(19) Europäisches Patentamt
European Patent Office
Office européen des brevets

(11) EP 4 175 187 A1

(12) **EUROPEAN PATENT APPLICATION**
published in accordance with Art. 153(4) EPC

(43) Date of publication:
**03.05.2023 Bulletin 2023/18**

(21) Application number: **21838335.4**

(22) Date of filing: **21.06.2021**

(51) International Patent Classification (IPC):
***H03M 13/13*** *(2006.01)*

(52) Cooperative Patent Classification (CPC):
**H03M 13/13; H04L 1/00**

(86) International application number:
**PCT/CN2021/101177**

(87) International publication number:
**WO 2022/007621 (13.01.2022 Gazette 2022/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.07.2020 CN 202010663589**

(71) Applicant: **Huawei Technologies Co., Ltd.**
**Longgang District,**
**Shenzhen,**
**Guangdong 518129 (CN)**

(72) Inventors:
- **WANG, Jun**
  **Shenzhen, Guangdong 518129 (CN)**
- **TONG, Wen**
  **Shenzhen, Guangdong 518129 (CN)**
- **WANG, Xianbin**
  **Shenzhen, Guangdong 518129 (CN)**
- **LI, Rong**
  **Shenzhen, Guangdong 518129 (CN)**
- **HUANGFU, Yourui**
  **Shenzhen, Guangdong 518129 (CN)**
- **DAI, Shengchen**
  **Shenzhen, Guangdong 518129 (CN)**
- **ZHANG, Huazi**
  **Shenzhen, Guangdong 518129 (CN)**
- **WANG, Jian**
  **Shenzhen, Guangdong 518129 (CN)**

(74) Representative: **Gill Jennings & Every LLP**
**The Broadgate Tower**
**20 Primrose Street**
**London EC2A 2ES (GB)**

# (54) POLAR CODE ENCODING/DECODING METHOD AND APPARATUS

(57) This application discloses a polar encoding method, apparatus, and a medium used in wireless communication, to meet transmission of a large amount of data and improve a system throughput. The method includes: obtaining K to-be-encoded bits, a mother code length N, and a first sequence, where the first sequence includes sequence numbers of N polarized subchannels, the sequence numbers of the N polarized subchannels are arranged in the first sequence based on reliability of the N polarized subchannels, $N = 2^n$, $K \leq N$, and K, n, and N are positive integers; and determining, based on the first sequence, K polarized subchannels used to contain the K to-be-encoded bits, and performing polarization encoding on the K to-be-encoded bits to obtain and output an encoded bit sequence.

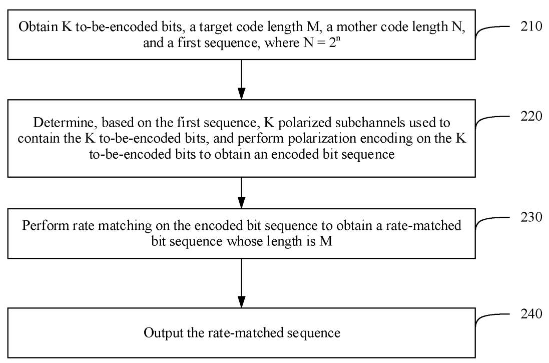

FIG. 2

EP 4 175 187 A1

## Description

### TECHNICAL FIELD

Embodiments of this application relate to the field of communications technologies, and in particular, to a polar code encoding method and apparatus.

### BACKGROUND

Channel encoding, as a most fundamental radio access technology, is crucial in ensuring reliable data transmission. In an existing wireless communications system, turbo code, low density parity check (low density parity check, LDPC) code, and polar (polar) code are usually used to perform channel encoding. The turbo code cannot support information transmission at an excessively low or high code rate. Due to encoding/decoding features of the turbo code and the LDPC code, for medium and short packet transmission, it is difficult for the turbo code and the LDPC code to achieve ideal performance in a case of a limited code length. During implementation, the turbo code and the LDPC code have high computation complexity in an encoding/decoding implementation process. The polar code is high-performance code that has been theoretically proved to be capable of achieving Shannon capacity and that has low encoding/decoding complexity, and therefore is applied increasingly widely.

In a 5th generation (5th generation, 5G) communications system, the polar code is determined as an encoding scheme of a control channel. Because a data amount included in the control channel is usually not large, a code block is not large. In the 3GPP standard, only a reliability ranking sequence whose mother code length is $N_{max}$ = 1024 is specified, and is used to sort reliability of 1024 subchannels to select a location of an information bit. For another case in which the mother code length N is less than 1024, a subsequence of the reliability ranking sequence in which $N_{max}$ = 1024 may be used as a corresponding reliability ranking sequence. A system design can be simplified by using this sequence nesting feature.

However, during data channel encoding, a long code block needs to be used for encoding in a plurality of cases. In this case, it is not enough to still use the reliability ranking sequence in which $N_{max}$ = 1024. Therefore, how to design a long reliability ranking sequence to meet a requirement of a data channel becomes a problem that needs to be resolved.

### SUMMARY

Embodiments of this application provide a polar code encoding method and apparatus applied to wireless communication, to support polar code encoding of a large data block, and to allow backward compatibility with a reliability ranking sequence supported by an existing NR system. This reuses the conventional technology to a maximum extent.

Specific technical solutions provided in embodiments of this application are as follows.

According to a first aspect, a polar code encoding method is provided, including:

An encoding apparatus obtains K to-be-encoded bits, a mother code length N, and a first sequence, where the first sequence includes sequence numbers of N polarized subchannels, the sequence numbers of the N polarized subchannels are arranged in the first sequence based on reliability of the N polarized subchannels, $N = 2^n$, and $K \leq N$, N is greater than or equal to 32, and K, n, and N are positive integers;

determines, based on the first sequence, K polarized subchannels used to contain the K to-be-encoded bits, and performs polarization encoding on the K to-be-encoded bits to obtain an encoded bit sequence;
performs rate matching on the encoded sequence to obtain a rate-matched sequence; and
outputs the rate-matched sequence, where
the first sequence is any Q sequence whose length is N in the appendix.

This design fits a feature of a large data block, and can be backward compatible with a reliability ranking sequence supported by an existing NR system. This reduces implementation difficulty.

In a possible design, the first sequence is a subsequence of a second sequence, the second sequence includes sequence numbers of $N_{max}$ polarized subchannels, the sequence numbers of the $N_{max}$ polarized subchannels are arranged in the second sequence based on reliability of the $N_{max}$ polarized subchannels, N is less than or equal to $N_{max}$, and $N_{max} = 2^{n_{max}}$, where $n_{max}$ is a positive integer, $n$ is less than or equal to $n_{max}$, and the second sequence is any Q sequence whose length is $N_{max}$ in the appendix.

In a possible design, the K to-be-encoded bits include a cyclic redundancy check bit.

In a possible design, the K to-be-encoded bits include a parity check bit.

In a possible design, the polar encoding method is performed by a network device or a terminal.

In a possible design, the determining, based on the first sequence, K polarized subchannels used to contain the K to-be-encoded bits is: when M is less than or equal to N, mapping the K to-be-encoded bits to the K polarized subchannels with high reliability in M - P non-punctured polarized subchannels to enable reliability of the polarized subchannels containing the K to-be-encoded bits to be higher than reliability of remaining M - P - K polarized subchannels, where M is a target code length, P is a quantity of pre-frozen polarized subchannels, and P is greater than or equal to 0.

In a possible design, the first sequence is prestored.

In a possible design, the sequence numbers of the N polarized subchannels are 0 to (N - 1) or 1 to N.

According to a second aspect, a polar code decoding method is provided, including:

A decoding apparatus obtains a to-be-decoded information sequence, where the to-be-decoded information sequence includes K to-be-decoded bits;

determines a mother code length N and a first sequence, where the first sequence includes sequence numbers of N polarized subchannels, the sequence numbers of the N polarized subchannels are arranged in the first sequence based on reliability of the N polarized subchannels, $N = 2^n$, $K \leq N$, N is greater than or equal to 32, and K, n, and N are positive integers;

determines, based on the first sequence, K polarized subchannels used to contain the K to-be-decoded bits, and decodes the to-be-decoded information sequence to obtain a decoding result; and

outputs the decoding result, where

the first sequence is any Q sequence whose length is N in the appendix or a subsequence of any Q sequence whose length is greater than N in the appendix.

This design completely corresponds to the encoding method according to the first aspect, fits a feature of a large data block, and can be backward compatible with a reliability ranking sequence supported by an existing NR system. This reduces implementation difficulty.

In a possible design, the first sequence is a subsequence of a second sequence, the second sequence includes sequence numbers of $N_{max}$ polarized subchannels, the sequence numbers of the $N_{max}$ polarized subchannels are arranged in the second sequence based on reliability of the $N_{max}$ polarized subchannels, N is less than or equal to $N_{max}$, and $N_{max} = 2^{n_{max}}$, where $n_{max}$ is a positive integer, $n$ is less than or equal to $n_{max}$, and the second sequence is any Q sequence whose length is $N_{max}$ in the appendix.

In a possible design, the K to-be-encoded bits include a cyclic redundancy check bit.

In a possible design, the K to-be-encoded bits include a parity check bit.

In a possible design, the polar encoding method is performed by a network device or a terminal.

In a possible design, the determining, based on the first sequence, K polarized subchannels used to contain the K to-be-encoded bits is: when M is less than or equal to N, mapping the K to-be-encoded bits to the K polarized subchannels with high reliability in M - P non-punctured polarized subchannels to enable reliability of the polarized subchannels containing the K to-be-encoded bits to be higher than reliability of remaining M - P - K polarized subchannels, where M is a target code length, P is a quantity of pre-frozen polarized subchannels, and P is greater than or equal to 0.

In a possible design, the first sequence is prestored.

In a possible design, the sequence numbers of the N polarized subchannels are 0 to (N - 1) or 1 to N.

According to a third aspect, a polar code encoding apparatus is provided. The apparatus has functions of implementing the method according to any one of the first aspect and the possible designs of the first aspect. The function may be implemented by hardware, or may be implemented by hardware executing corresponding software. The hardware or the software includes one or more modules corresponding to the foregoing function.

In a possible design, when some or all of the functions are implemented by using hardware, the polar code encoding apparatus includes: an input interface circuit, configured to obtain a to-be-encoded bit; a logical circuit, configured to perform the operation according to any one of the first aspect and the possible designs of the first aspect; and an output interface circuit, configured to output a rate-matched sequence.

Optionally, the polar code encoding apparatus may be a chip or an integrated circuit.

In a possible design, when some or all of the functions are implemented by using software, the polar code encoding apparatus includes: a memory, configured to store a program; and a processor, configured to execute the program stored in the memory. When the program is executed, the polar code encoding apparatus may implement the method according to any one of the first aspect and the possible designs of the first aspect.

Optionally, the memory may be a physically independent unit, or may be integrated with the processor.

In a possible design, when some or all of the functions are implemented by using software, the polar code encoding apparatus includes a processor. A memory configured to store a program is located outside of the polar code encoding apparatus, and the processor is connected to the memory through a circuit/cable, and is configured to read and execute the program stored in the memory.

In a possible design, the apparatus is a network device or a terminal.

According to a fourth aspect, a polar code decoding apparatus is provided. The apparatus has functions of implementing the method according to any one of the second aspect and the possible designs of the second aspect. The function may be implemented by hardware, or may be implemented by hardware executing corresponding software. The hardware or the software includes one or more modules corresponding to the foregoing function.

In a possible design, when some or all of the functions are implemented by using hardware, the polar code decoding apparatus includes: an input interface circuit, configured to obtain a to-be-decoded information sequence; a logical circuit, configured to perform the operation according to any one of the second aspect and the possible designs of the second aspect; and an output interface circuit, configured to output a decoding result.

Optionally, the polar code decoding apparatus may be a chip or an integrated circuit.

In a possible design, when some or all of the functions are implemented by using software, the polar code decoding apparatus includes: a memory, configured to store a program; and a processor, configured to execute the program stored in the memory. When the program is executed, the polar code decoding apparatus may implement the method according to any one of the first aspect and the possible designs of the first aspect.

Optionally, the memory may be a physically independent unit, or may be integrated with the processor.

In a possible design, when some or all of the functions are implemented by using software, the polar code decoding apparatus includes a processor. A memory configured to store a program is located outside of the polar code decoding apparatus, and the processor is connected to the memory through a circuit/cable, and is configured to read and execute the program stored in the memory.

In a possible design, the apparatus is a network device or a terminal.

According to a fifth aspect, a communications system is provided. The communications system includes a network device and a terminal. The network device performs the method according to the first aspect and the possible designs of the first aspect, and the terminal performs the method according to the second aspect and the possible designs of the second aspect. Alternatively, the terminal network device performs the method according to the first aspect and the possible designs of the first aspect, and the network device performs the method according to the second aspect and the possible designs of the second aspect.

According to a sixth aspect, a computer storage medium is provided, where the computer storage medium stores a computer program. The computer program includes instructions used to perform the method according to any one of the first aspect and the possible designs of the first aspect.

According to a seventh aspect, a computer storage medium is provided, where the computer storage medium stores a computer program. The computer program includes instructions used to perform the method according to any one of the second aspect and the possible designs of the second aspect.

According to an eighth aspect, an embodiment of this application provides a computer program product including instructions. When the instructions are run on a computer, the computer is enabled to perform the method in the foregoing aspects.

According to a ninth aspect, a wireless device is provided, including an encoding apparatus and a transceiver that are configured to implement any one of the first aspect and the possible designs of the first aspect.

The transceiver is configured to receive or send a signal.

In a possible design, the wireless device is a terminal or a network device.

According to a tenth aspect, a wireless device is provided, including an encoding apparatus and a transceiver that are configured to implement any one of the second aspect and the possible designs of the second aspect.

The transceiver is configured to receive or send a signal.

In a possible design, the wireless device is a terminal or a network device.

## BRIEF DESCRIPTION OF DRAWINGS

FIG. 1 is a schematic diagram of an architecture of a communications system to which an embodiment of this application is applied;

FIG. 2 is a schematic flowchart of a polar code encoding method according to an embodiment of this application;

FIG. 3 is a first schematic diagram of a structure of a polar code encoding apparatus according to an embodiment of this application;

FIG. 4 is a second schematic diagram of a structure of a polar code encoding apparatus according to an embodiment of this application;

FIG. 5 is a third schematic diagram of a structure of a polar code apparatus according to an embodiment of this application;

FIG. 6 is a fourth schematic diagram of a structure of a polar code encoding apparatus according to an embodiment of this application;

FIG. 7 is a first schematic diagram of a structure of a polar code decoding apparatus according to an embodiment of this application;

FIG. 8 is a second schematic diagram of a structure of a polar code decoding apparatus according to an embodiment of this application;

FIG. 9 is a third schematic diagram of a structure of a polar code decoding apparatus according to an embodiment of this application; and

FIG. 10 is a fourth schematic diagram of a structure of a polar code decoding apparatus according to an embodiment of this application.

## DESCRIPTION OF EMBODIMENTS

The following describes in detail embodiments of this application with reference to accompanying drawings.

If a polar code encoding scheme used for a control channel in an existing 5G NR standard is directly applied to data without considering a feature of a data channel, because in the current 5G NR standard, a maximum mother code length of a polar code is 1024, a data packet length that can be supported is limited. Therefore, it is necessary to redesign the polar code encoding scheme, to be more suitable for the data channel. In addition, it is optimal that the polar code encoding scheme is applicable to the control channel.

Embodiments of this application provide a polar code encoding method and apparatus. A sequence number of a polarized subchannel used to send an information bit is selected based on a prestored reliability ranking sequence or a subsequence of the reliability ranking sequence, and polar code encoding is performed based on the selected sequence number of the information polarized subchannel. Then, a rate matching operation is performed on an encoded sequence, and a rate-matched sequence is output, where the rate matching operation includes repetition, puncturing, or shortening. Embodiments of this application are more applicable to the data channel. The following describes in detail the polar code encoding method and apparatus provided in embodiments of the present invention with reference to the accompanying drawings.

For convenience of understanding embodiments of this application, polar code is briefly described below.

According to an encoding policy of the polar code, a noiseless channel is used to transmit information useful to a user, while a pure noisy channel is used to transmit agreed information or is not used to transmit information. The polar code is also linear block code. An encoding matrix of the polar code is $G_N$, and an encoding process is $x_1^N = u_1^N G_N$. $u_1^N = (u_1, u_2, \ldots, u_N)$ is a binary row vector whose length is $N$ (that is, a code length. It can be learned that lengths of the sequences $x$ and $u$ before and after encoding are both $N$, where $N$ is also referred to as a mother code length). $G_N$ is an $N \times N$ matrix, and $G_N = F_2^{\otimes(\log_2(N))}$. $F_2^{\otimes(\log_2(N))}$ is defined as a Kronecker (Kronecker) product of $\log_2 N$ matrices $F_2$. The matrix $F_2 = \begin{bmatrix} 1 & 0 \\ 1 & 1 \end{bmatrix}$. In some implementations, there may be a transpose matrix in $u_1^N$ and $G_N$. Because polar code performance is not affected essentially, details are not described in this application.

In a polar code encoding process, one part of bits in $u_1^N$ are used to carry information, and are referred to as a set of information bits, where a set of indexes of the bits is denoted as A ; and another part of bits are set to a fixed value pre-agreed upon between a receiving end and a transmitting end, and are referred to as a set of fixed bits or a set of frozen bits (frozen bits), where a set of indexes of the bits is indicated by a complementary set $A^c$ of A . The polar code encoding process is equivalent to: $x_1^N = u_A G_{N.}(A) \oplus u_{A^c} G_{N.}(A^C)$. Herein, $G_N(A)$ is a submatrix obtained by using rows corresponding to the indexes in the set A in $G_N$, and $G_N(A^C)$ is a submatrix obtained by using rows corresponding to the indexes in the set $A^c$ in $G_N$. $u_A$ is an information bit set in $u_1^N$, and a quantity of information bits is K. Usually, various types of check bits including but not limited to a cyclic redundancy check (Cyclic Redundancy Check, CRC for short) bit and a parity check (Parity Check, PC for short) bit may also be included in the information bit set. $u_{AC}$ is a frozen bit set in $u_1^N$, a quantity of frozen bits is (N - K), and the frozen bits are known bits. These frozen bits are usually set to 0. However, values of the frozen bits may be set to any value provided that the value is pre-agreed on by the receiving end and the transmitting end. Therefore, an encoding output of the polar code may be simplified as $x_1^N = u_A G_N(A)$. Herein, $u_A$ is the information bit set in $u_1^N$, and $u_A$ is a row vector of a length $K$, that is, $|A| = K$. $|\cdot|$ indicates a quantity of elements in the set, $K$ is an information block size, $G_N(A)$ is the submatrix obtained by using the rows corresponding to the indexes in the set A in the matrix $G_N$, and $G_N(A)$ is a $K \times N$ matrix.

After the mother code length N is determined, a polar code construction process is a selection process of the set A , and polar code performance is determined. The polar code construction process is usually as follows: It is determined, based on the mother code length N that N polarized channels co-exist, where the N polarized channels respectively correspond to N rows in an encoding matrix.

When rate matching is not performed, indexes of first K polarized subchannels with high reliability are used as elements of the set A , and indexes corresponding to remaining (N - K) polarized subchannels are used as elements of the index set $A^c$ of the frozen bits. The set A determines a location of the information bit, and the set $A^c$ determines a location of the frozen bit. A sequence number of a polarized channel is a location index of an information bit or a frozen bit, that is, a location index in $u_1^N$.

When rate matching is performed, particularly when puncturing (puncture) or shortening (shorten) is performed, N - M polarized subchannels that need to be punctured or shortened (that is, deleted) usually are first determined. Herein, M is a target code length, that is, a length of a rate-matched bit sequence, and the N - M polarized subchannels selected herein are used to contain frozen bits. In the 5G NR standard, when puncturing is performed, some pre-frozen polarized subchannels are further additionally determined, and are also used to contain frozen bits. Herein, a quantity of the pre-frozen polarized subchannels are defined as P, and P is greater than or equal to 0 (in 5G NR, when shortening is performed, P is 0, and in this case, P may not need to be considered. This is not limited in this application). Then, the K polarized subchannels with high reliability are selected from remaining M - P polarized subchannels based on reliability to contain K information bits. Certainly, M - P - K subchannels with low reliability may alternatively be first selected to contain frozen bits, and remaining K subchannels are used to contain information bits. Reliability of any one of the K polarized subchannels containing the K information bits is higher than reliability of any one of the M - P - K subchannels containing the frozen bits. In this application, a value of P is not limited. Even when puncturing is performed, P may be 0. Even when shortening is performed, P may be greater than 0. This does not affect implementation of the technical solutions in this application. Regardless of an encoder or a decoder, principles and methods for determining that the K subchannels are used to contain the K information bits are consistent. In the 5G NR standard, for selection of N - M polarized subchannels, a solution is to contain a sequence obtained after subblock interleaving (divided into 32 subblocks) in a circular buffer (English: circular buffer, equivalent to a rate-matched sequence). If puncturing is performed, reading starts from an (N - M)th location in the circular buffer, and bits from a $0^{th}$ location to an $(N - M - 1)^{th}$ location are discarded. If shortening is performed, reading starts from a $0^{th}$ location to an $(M - 1)^{th}$ location in the circular buffer, and bits from an $M^{th}$ location to an $(N - 1)^{th}$ location are discarded. Generally, a reliability ranking sequence whose length is the mother code length N is used to represent a relative reliability relationship between different polarized subchannels. The reliability ranking sequence includes sequence numbers (starting from 0 to N - 1) of N polarized subchannels, and the sequence numbers may be arranged in descending order or ascending order of reliability. Without loss of generality, this application uses an example in which the sequence numbers are arranged in ascending order of the reliability.

It should be noted that the relative reliability relationship described herein is based on a specific reliability calculation manner. Different reliability calculation manners may cause a change in the relative reliability relationship between the polarized subchannels. However, methods for selecting polarized subchannels used to contain information bits are the same. In addition to the 5G NR standard, it may also be considered that an information bit is contained by a last punctured or shortened polarized subchannel. In this application, it is not limited that the polarized subchannel containing the information bit needs to be selected according to the 5G NR standard.

In the 5G NR standard, when reliability ranking sequences corresponding to different mother code lengths meet a nesting feature, that is, the mother code length N is less than or equal to a mother code length N', a relative relationship between reliability of polarized subchannels (polarized subchannels 0, ..., and N - 1) in the reliability ranking sequence corresponding to N is consistent with a relative relationship between the reliability of the polarized subchannels (the polarized subchannels 0, ..., and N - 1) in a reliability ranking sequence corresponding to N'. In other words, in the reliability ranking sequence corresponding to N', only numbers of polarized subchannels less than N are retained, and a relative ranking relationship between locations of the numbers of the N polarized subchannels is not changed. In this way, the reliability ranking sequence corresponding to N can be obtained. Therefore, the reliability ranking sequence whose length is N may be referred to as a subsequence of the reliability ranking sequence whose length is N', where N is less than or equal to N'. For example, N' = 8, and a reliability ranking sequence 1 is [0, 4, 6, 2, 3, 1, 7, 5]. Correspondingly, if N = 4, and a reliability ranking sequence 2 is [0, 2, 3, 1], the sequence 2 is a subsequence of the sequence 1. Therefore, in a specific implementation, reliability ranking sequences of different mother code lengths may be prestored. Alternatively, only a reliability ranking sequence whose length is equal to a maximum mother code length $N_{max}$ may be prestored, and another reliability ranking sequence corresponding to the mother code length N is obtained by retaining only sequence numbers of polarized subchannels less than N in the reliability ranking sequence corresponding to the maximum mother code length. In this way, storage overheads can be reduced. Particularly, a sequence may also be a subsequence of the sequence. Therefore, a largest value of N may be equal to $N_{max}$.

FIG. 1 is a schematic diagram of a structure of a wireless communications network according to an embodiment of the present invention. FIG. 1 is merely an example, and other wireless networks to which the encoding method or apparatus in embodiments of the present invention can be applied shall fall within the protection scope of the present invention.

As shown in FIG. 1, the wireless communications network 100 includes a network device 110 and a terminal 112. When the wireless communications network 100 includes a core network 102, the network device 110 may further be connected to the core network 102. The network device 110 may further communicate with an IP network 104 such as the Internet (Internet), a private IP network, or another data network. The network device provides services for a terminal within coverage. For example, refer to FIG. 1. The network device 110 provides wireless access for one or more terminals 112 within the coverage of the network device 110. In addition, coverage of network devices, for example, the network device 110 and a network device 120, may have an overlapping area. The network devices may further communicate with each other. For example, the network device 110 may communicate with the network device 120.

The network device may be a device configured to communicate with a terminal device. For example, the network device may be an evolved NodeB (Evolved NodeB, eNB, or eNodeB) in an LTE system, may be a gNB in a 5G network, may be a satellite in satellite communication, a network side device in a future communications system, or the like. Alternatively, the network device may be a relay station, an access point, a vehicle-mounted device, or the like. In a device to device (Device to Device, D2D) communications system, a machine to machine (Machine to Machine, M2M) communications system, and an Internet of vehicles system, the network device may alternatively be a terminal that functions as a base station.

The terminal may be user equipment (User Equipment, UE), an access terminal, a subscriber unit, a mobile station, a remote station, a remote terminal, a mobile device, a user terminal, a wireless communications device, a user agent, or a user apparatus. The access terminal may be a cellular phone, a cordless phone, a session initiation protocol (Session Initiation Protocol, SIP) phone, a wireless local loop (Wireless Local Loop, WLL) station, a personal digital assistant (Personal Digital Assistant, PDA), a handheld device having a wireless communications function, a computing device, another processing device connected to a wireless modem, a vehicle-mounted device, a wearable device, or a terminal device in a future communications network.

Based on the architecture of the communications system shown in FIG. 1, in embodiments of this application, the polar code encoding method may be performed by the foregoing network device or terminal. When the network device or the terminal is used as a transmitting end to send data or information, the polar code encoding method may be used. Correspondingly, when the network device or the terminal serves as a receiving end to receive data or information, the network device or the terminal also needs to determine a reliability ranking sequence according to the method described in the present invention and then perform decoding. The following describes in detail the polar code encoding method provided in embodiments of this application.

Based on the architecture of the communications system shown in FIG. 1, as shown in FIG. 2, a specific process of a polar code encoding method provided in an embodiment of this application is as follows.

Operation 210: Obtain K to-be-encoded bits, a target code length M, a mother code length N, and a first sequence, where the first sequence is a reliability ranking sequence and includes sequence numbers of N polarized subchannels, the sequence numbers of the N polarized subchannels are arranged in the first sequence based on reliability of the N polarized subchannels, $N = 2^n$, and $K \leq N$. In an application scenario of polar code, N may be a value greater than or equal to 32, and M, K, n, and N are positive integers.

The K to-be-encoded bits herein may include only a payload bit, or may include one or more types of other types of non-frozen bits such as a CRC bit and a PC bit in addition to the payload bit.

How to obtain the mother code length N based on factors such as the target code length M and a code rate is specified in the 5G NR system. Because this is not a technical problem to be resolved in this application, the manner of obtaining the mother code length N is directly used, but it is not indicated that only the 5G NR manner can be used to obtain the mother code length N in the solution of this application.

After N is determined, the first sequence whose length is N may be determined. As described above, the first sequence may be prestored, or may be a subsequence whose length is N and that is extracted from a second sequence. The second sequence is a reliability ranking sequence whose length is a maximum mother code length $N_{max}$. Specifically, the first sequence may be any Q sequence whose length is N in the appendix or a subsequence of any Q sequence whose length is greater than N in the appendix, the second sequence may be any Q sequence whose length is $N_{max}$ in the appendix, and the first sequence is a subsequence of the second sequence, where N is less than or equal to $N_{max}$. $N_{max}$ may be any one of 2048, 4096, 8192, and 16384.

In this application, the appendix provides, based on decoding implementation, rate matching, and code block retransmission, eight groups of polar code reliability ranking sequences applicable to long code block encoding. In terms of reliability, each group of sequences includes reliability ranking sequences (Qx_y sequences, which are generally referred to as Q sequences for ease of understanding, where x is any integer from 1 to 8, and y is any value in 2048, 4096, 8192, and 16384. This also applies to the following statements) that are of lengths of 2048, 4096, 8192, and 16384 and that are arranged in ascending order of the reliability, and corresponding reliability location sequences (Zx_y sequences, which are generally referred to as Z sequences for ease of understanding, where x is any integer from 1 to 8, and y is any value in 2048, 4096, 8192, and 16384. This also applies to the following statements). For the Q sequence, each value in the sequence is a sequence number of a polarized subchannel, and a location of the value in the sequence is a reliability order. A higher location indicates lower reliability. For the Z sequence, each value in the sequence is a reliability order of a location of the value (that is, a polarized subchannel containing the value) in reliability of all polarized subchannels. The Q sequence is in a one-to-one correspondence with the Z sequence. In a simple example, if a Q sequence is [0, 4, 6, 2, 3, 1, 7, 5], a corresponding Z sequence is [0, 5, 3, 4, 1, 7, 2, 6], and both the Q sequence and the Z sequence indicate that a polarized subchannel 5 has highest reliability, a polarized subchannel 7 has second highest reliability, and a polarized subchannel 1 has third highest reliability. The rest may be deduced by analogy. A polarized subchannel 0 has lowest reliability. It should be noted that only reliability ranking sequences whose lengths are greater than 1024 is provided in the appendix. This is because the sequences are backward compatible. To be specific, a reliability ranking sequence whose length is $N_{max}$ = 1024 and that is specified in the 5G NR protocol is a subsequence of any Qx_y sequence in the appendix. In other words, reliability ranking sequences whose lengths are separately 32, 64, 128, 256, 512, or 1024 and that are used in the 5G NR protocol are subsequences of any Qx_y sequence in the appendix. In an actual implementation, K polarized subchannels are usually selected by using the Q sequence, but may also be selected by using the Z sequence.

Sequence group 1 (Q1_y and Z1_y): A criterion for designing the sequence is to ensure decoding performance and provide a high degree of parallelism for polar decoding, to further reduce a decoding delay.

Sequence group 2 (Q2_y and Z2_y): Currently, in NR, in addition to a repetition rate matching scheme, there are two rate matching schemes based on a code rate: puncturing and shortening. A criterion for designing the sequence is to preferentially optimize performance in the rate matching scheme in which puncturing is performed.

Sequence group 3 (Q3_y and Z3_y): Currently, in NR, in addition to a repetition rate matching scheme, there are two rate matching schemes based on a code rate: puncturing and shortening. A criterion for designing the sequence is to preferentially optimize performance in the rate matching scheme in which shortening is performed.

Sequence group 4 (Q4_y and Z4_y): HARQ needs to be supported in a data channel. Currently, a polar code HARQ solution commonly used in the industry mainly includes IR and IF. A criterion for designing the sequence is to consider both IR (Incremental Redundancy, incremental redundancy) HARQ performance and IF (Incremental Frozen, incremental frozen) HARQ performance.

In a high-throughput communications scenario of a data channel, a system defines several fixed MCS formats, and corresponding required mother code lengths are expected to include 2048/4096/8192/16384 and the like. The mother code lengths vary with different subdivided scenarios. Therefore, some reliability ranking sequences are designed for different mother code lengths and modulation schemes in the present invention.

Sequence group 5 (Q5_y and Z5_y): Performance in a 16-QAM modulation scheme is preferentially considered, but it can also be ensured that performance in another modulation scheme can meet a requirement.

Sequence group 6 (Q6_y and Z6_y): Performance in a 64-QAM modulation scheme is preferentially considered, but it can also be ensured that performance in another modulation scheme can meet a requirement.

Sequence group 7 (Q7_y and Z7_y): Performance of a mother code length 2048 is preferentially considered, but it can also be ensured that performance of another mother code length can meet a requirement.

Sequence group 8 (Q8_y and Z8_y): Performance of a mother code length 4096 is preferentially considered, but it can also be ensured that performance of another mother code length can meet a requirement.

Pay attention to the following points:

1. A reliability ranking sequence whose length is 1024 given in the 5G NR protocol is a subsequence of any Q sequence in the appendix. In this way, a data channel encoding requirement is met, and compatibility with an existing protocol is ensured. Correspondingly, reliability ranking sequences that are used in the 5G NR protocol and whose lengths are separately 32, 64, 128, 256, 512, or 1024 are subsequences of any Q sequence in the appendix.
2. Locations of fewer elements in the sequence are exchanged. For example, a sequence number location may be adjusted by a specified magnitude, for example, the specified magnitude is 5. A location of an element whose sequence number is 10 may be adjusted by left and right five locations.
3. Some elements in the sequence are adjusted, but channel sets that are used to transmit T-bit information and that are selected based on the sequence are consistent or similar.
4. The sequence includes N elements from 0 to N - 1, and the N elements from 0 to N - 1 represent sequence numbers of N polarized subchannels. Actually, the sequence numbers of the N polarized subchannels may alternatively start from 1 and end with N, that is, 1 is added to the sequence numbers in the foregoing sequence. This is also a sequence number form in the foregoing calculation manner. Certainly, a sequence number or an identifier of the polar subchannel may alternatively be represented in another manner. The specific representation manner does not affect a specific location of the polar subchannel in the sequence.

Operation 220: Determine, based on the first sequence, the K polarized subchannels used to contain the K to-be-encoded bits, and perform polarization encoding on the K to-be-encoded bits to obtain an encoded bit sequence.

For a specific encoding operation, refer to the foregoing description. A specific scheme of rate matching may be first determined. When puncturing or shortening is performed, polarized subchannels to be punctured or shortened (that is, deleted) and possible P pre-frozen polarized subchannels (P is greater than or equal to 0) are first determined, and the K polarized subchannels with high reliability are selected from remaining M - P polarized subchannels based on reliability to contain K information bits. When repetition is performed, the K polarized subchannels with high reliability are directly selected from the N polarized subchannels based on reliability to contain the K information bits. A decoder may also determine locations of the K information bits in the same manner.

Operation 230: Perform a rate matching operation on the encoded bit sequence to obtain a rate-matched bit sequence whose length is M.

For a specific rate matching operation, refer to a manner in which block interleaving is first performed and then bits are sequentially fetched in a circular buffer in 5G NR. Alternatively, a specific rate matching operation may be performed by using a preset rate matching sequence. This is not limited herein.

Operation 240: Output the rate-matched sequence.

It should be noted that if a modulation operation is used, the output herein should be a sequence obtained after modulation is performed on a rate-matched bit sequence. The sequence is a symbol sequence. In this case, a length of the sequence may not be M. If modulation is not used, the rate-matched sequence is a rate-matched bit sequence. For ease of understanding, terms "rate-matched sequence" and "rate-matched bit sequence" are not strictly distinguished in this application.

The embodiment shown in FIG. 2 is an operation of a transmitting end, and an operation of a receiving end is similar. After receiving a to-be-decoded information sequence, a receiver (or a receiving apparatus) also needs to use a similar method. Specifically, a to-be-decoded information sequence including K to-be-decoded bits, a target code length M, and a mother code length N is obtained, a first sequence is determined, K polarized subchannels used to contain the K to-be-decoded bits are determined based on the first sequence, and a decoding operation is performed on the to-be-decoded information sequence to obtain and output a decoding result. A detailed decoding algorithm is not limited herein.

As shown in FIG. 3, an embodiment of this application further provides a polar code encoding apparatus 300. Some or all of the polar code encoding method shown in FIG. 3 may be implemented by hardware, or may be implemented by software.

For the polar code encoding apparatus 300, based on a same inventive concept as the polar code encoding method shown in FIG. 2, the polar code encoding apparatus 300 is configured to perform the polar code encoding method shown in FIG. 2. When some or all of the polar code encoding method is implemented by hardware, the polar code encoding apparatus 300 includes: an input interface circuit 301, configured to obtain to-be-encoded bits; a logic circuit 302, configured to perform the polar code encoding method shown in FIG. 2, where for details, refer to description in the foregoing method embodiments, and details are not described herein again; and an output interface circuit 303, configured to output a rate-matched sequence. Further, the rate-matched sequence is still a modulated sequence. The sequence is a modulated symbol sequence, and is output to a transceiver 320. The transceiver 320 performs corresponding processing (including but not limited to processing such as digital-to-analog conversion and/or frequency conversion) on the modulated sequence, and sends a processed modulated sequence through an antenna 330. Optionally, in a specific implementation, the polar code encoding apparatus 300 may be a chip or an integrated circuit.

Optionally, when some or all of the polar code encoding method in the foregoing embodiment is implemented by software, as shown in FIG. 4, a polar code encoding apparatus 400 includes: a memory 401, configured to store a program; and a processor 402, configured to execute the program stored in the memory 401. When the program is executed, the polar code encoding apparatus 400 can implement the polar code encoding method provided in the foregoing embodiment.

Optionally, the memory 401 may be a physically independent unit. Alternatively, as shown in FIG. 5, a memory 501 and a processor 502 may be integrated together.

Optionally, when some or all of the encoding method in the foregoing embodiment is implemented by software, the polar code encoding apparatus 400 may alternatively include only the processor 402. The memory 401 configured to store the program is located outside the polar code encoding apparatus 400. The processor 402 is connected to the memory 401 through a circuit/cable, and is configured to read and execute the program stored in the memory 401.

Based on the polar code encoding method shown in FIG. 2, as shown in FIG. 6, an embodiment of this application further provides a polar code encoding apparatus 600. The polar code encoding apparatus 600 is configured to perform the polar code encoding method shown in FIG. 2. The polar code encoding apparatus 600 includes:

an obtaining unit 601, configured to obtain K to-be-encoded bits;

an encoding unit 602, configured to: determine a mother code length N and a first sequence (a reliability ranking sequence whose length is N), and perform polar encoding on the K to-be-encoded bits based on the mother code length N to obtain an encoded bit sequence, where for a specific encoding process, refer to operation 220 in the foregoing embodiment; and

a rate matching unit 603, configured to perform a rate matching operation on the encoded bit sequence to obtain a rate-matched bit sequence whose length is M (or a sequence obtained through further modulation on the bit sequence, which is also referred to as a rate-matched sequence), where for a specific rate matching method, refer to operation 230 in the foregoing embodiment.

Corresponding to the transmitting end, an apparatus at the receiving end may also be designed similarly.

As shown in FIG. 7, a polar code decoding apparatus 700 includes: an input interface circuit 701, configured to obtain a to-be-decoded information sequence; a logic circuit 702, configured to perform the foregoing polar code decoding method to obtain a decoded information bit; and an output interface circuit 703, configured to output decoded information. The polar code decoding apparatus 700 may further include a transceiver 720 that obtains the to-be-decoded information sequence through an antenna 730. In a specific implementation, the polar code decoding apparatus 700 may be a chip or an integrated circuit.

Optionally, when some or all of the polar code decoding method in the foregoing embodiment is implemented by software, as shown in FIG. 8, a polar code decoding apparatus 800 includes: a memory 801, configured to store a program; and a processor 802, configured to execute the program stored in the memory 801. When the program is executed, the polar code decoding apparatus 800 can implement the polar code decoding method provided in the foregoing embodiment.

Optionally, the memory 801 may be a physically independent unit. Alternatively, as shown in FIG. 9, a memory 901 and a processor 902 may be integrated together.

Optionally, when some or all of the decoding method in the foregoing embodiment is implemented by software, the polar code decoding apparatus 800 may alternatively include only the processor 802. The memory 801 configured to store the program is located outside the polar code decoding apparatus 800. The processor 802 is connected to the memory 801 through a circuit/cable, and is configured to read and execute the program stored in the memory 801.

The processor 402 and/or the processor 802 may be a central processing unit (central processing unit, CPU), a network processor (network processor, NP), or a combination of the CPU and the NP.

The processor 402 and/or the processor 802 may further include a hardware chip. The hardware chip may be an application-specific integrated circuit (application-specific integrated circuit, ASIC), a programmable logic device (programmable logic device, PLD), or a combination thereof. The PLD may be a complex programmable logic device (complex programmable logic device, CPLD), a field-programmable gate array (field-programmable gate array, FPGA), generic array logic (generic array logic, GAL), or any combination thereof.

The memory in the foregoing embodiments may include a volatile memory (volatile memory), for example, a random-access memory (random-access memory, RAM). Alternatively, the memory may include a non-volatile memory (non-volatile memory), such as a flash memory (flash memory), a hard disk drive (hard disk drive, HDD), or a solid-state drive (solid-state drive, SSD). Alternatively, the memory may include a combination of the foregoing types of memories.

Based on the foregoing polar code decoding method, as shown in FIG. 10, an embodiment of this application further provides a polar code decoding apparatus 1000. The polar code decoding apparatus 1000 is configured to perform the foregoing polar code decoding method. The polar code decoding apparatus 1000 includes:

an obtaining unit 1001, configured to obtain a to-be-decoded information sequence; and
a processing unit 1002, configured to: determine a first sequence of a mother code length N (a reliability ranking sequence whose length is N), and perform a decoding operation on the to-be-decoded information sequence to obtain and output a decoding result.

An embodiment of this application further provides a computer storage medium that stores computer program instructions. When the computer program instructions are executed by a computer, the foregoing polar code encoding method or polar code decoding method is performed.

An embodiment of this application further provides a computer program product including instructions. When the computer program product runs on a computer, the foregoing polar code encoding method or polar code decoding method is performed.

A person skilled in the art should understand that embodiments of this application may be provided as a method, a system, or a computer program product. Therefore, this application may use a form of hardware only embodiments, software only embodiments, or embodiments with a combination of software and hardware. In addition, this application may use a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the device (system), and the computer program product according to embodiments of this application. It should be understood that computer program instructions may be used to implement each process and/or each block in the flowcharts and/or the block diagrams and a combination of a process and/or a block in the flowcharts and/or the block diagrams. The computer program instructions may be provided for a general-purpose computer, a dedicated computer, an embedded processor, or a processor of another programmable data processing device to generate a machine, so that the instructions executed by a computer or a processor of another programmable data processing device generate an apparatus for implementing a specific function in one or more processes in the flowcharts and/or in one or more blocks in the block diagrams.

The computer program instructions may be stored in a computer-readable memory that can instruct the computer or another programmable data processing device to work in a specific manner, so that the instructions stored in the computer-readable memory generate an artifact that includes an instruction apparatus. The instruction apparatus implements a specific function in one or more processes in the flowcharts and/or in one or more blocks in the block diagrams.

The computer program instructions may alternatively be loaded onto a computer or another programmable data processing device, so that a series of operations and steps are performed on the computer or the another programmable device. In this way, computer-implemented processing is generated. Therefore, the instructions executed on the computer or the another programmable device provide steps for implementing a specific function in one or more processes in the flowcharts and/or in one or more blocks in the block diagrams.

Although some example embodiments of this application have been described, a person skilled in the art can make changes and modifications to these embodiments once the person skilled in the art learns of the basic inventive concept. Therefore, the following claims are intended to be construed as to cover the embodiments and all changes and modifications falling within the scope of this application.

Clearly, a person skilled in the art can make various modifications and variations to embodiments of this application without departing from the spirit and scope of embodiments of this application This application is intended to cover these modifications and variations provided that they fall within the scope of protection defined by the following claims and their equivalent technologies.

Appendix:

**Sequence group 1: Q1_2048**

[0,1,2,4,8,16,32,3,5,64,9,6,17,10,18,128,12,3
3,65,20,256,34,24,36,7,129,66,512,11,40,68,130,19,1
3,48,1
4,72,257,21,132,35,258,26,513,80,37,25,22,136,260,2
64,38,514,96,1024,1025,67,41,144,28,69,42,516,49,7
4,272,16
0,520,288,528,192,544,70,44,131,81,50,73,15,320,13
3,52,23,134,384,76,1026,1028,137,82,56,27,97,39,25
9,84,138,
145,261,29,43,98,515,88,1032,1040,140,30,146,71,26
2,265,161,576,45,100,640,51,148,46,1056,1027,75,26
6,273,5
17,104,162,53,193,1029,1088,152,77,1033,1030,164,
768,1041,1034,268,274,518,54,83,57,521,112,135,78,
289,194,
85,276,522,58,168,139,99,86,60,280,89,290,529,524,
196,141,101,147,176,142,530,321,31,200,90,545,292,
322,532,
263,149,102,105,304,296,163,92,47,267,385,546,324,
208,386,1042,1152,150,153,165,106,55,328,536,577,
548,113,
154,79,269,108,578,224,1036,1057,166,519,552,195,
1089,1044,270,641,523,275,580,291,59,169,560,114,
277,156,
1280,1058,87,197,116,170,61,531,525,642,281,278,5
26,177,293,388,1048,1060,91,584,769,198,1031,1153
,172,120 ,201,336,62,282,1090,1536,143,103,178,294
,93,644,202,592,323,392,297,770,107,180,1035,1064,
151,209,284,648,
94,204,298,400,608,352,325,533,155,210,305,547,30
0,109,1092,1154,1043,1037,184,534,537,115,167,225
,326,306 ,772,157,656,329,1072,1038,110,117,212,17
1,776,330,226,549,1096,1281,538,387,308,216,1045,
1156,416,271,279 ,158,337,550,672,118,332,579,540,
389,173,121,553,199,784,179,228,338,312,704,1059,
1282,390,174,554,581,393,
283,122,448,353,561,203,63,340,394,527,582,556,18
1,1050,1537,1104,1061,1049,1046,295,285,232,124,2
05,182,6
43,562,286,585,1160,1284,299,354,211,401,1288,106
2,1538,1120,185,396,344,586,1091,1065,1168,1052,6
45,593,
1093,1066,535,240,206,95,327,564,1540,1073,800,40
2,356,307,301,417,213,568,832,588,186,646,404,227,
896,594 ,1098,1296,1184,1544,1312,1552,418,302,64
9,771,1216,1568,360,539,111,331,214,309,188,449,1
094,1068,1155,1
105,217,408,609,596,551,650,229,159,420,310,541,7
73,610,657,333,119,600,339,218,368,652,230,391,31
3,1074,1
097,450,542,1039,1344,334,233,555,774,175,123,115
7,1076,658,612,341,777,220,314,424,395,673,583,10
47,1158,
355,287,183,234,125,557,660,616,1408,1100,342,316
,241,778,1161,1106,563,345,452,397,403,207,1080,1
051,674,
558,785,432,357,187,1121,1063,1283,1108,236,664,6
24,587,780,705,126,242,565,398,1162,1169,346,456,
1285,10
53,358,405,303,569,244,595,189,566,676,361,1067,1
122,706,589,215,786,1539,1112,1164,1054,647,348,4
19,406,4
64,680,801,362,590,409,570,788,597,572,219,311,11
70,1095,1286,1289,708,598,601,651,1185,1600,1069,
1124,42
1,792,802,611,602,410,1664,1075,231,688,1172,1070
,653,248,369,190,364,654,659,335,1099,1290,480,31
5,221,37
0,1297,1541,1128,1186,613,422,425,451,614,543,235
,412,343,372,1077,1217,775,317,222,426,453,237,55
9,833,11
76,1101,1188,1792,1292,1298,804,712,834,661,808,7
79,617,604,433,720,816,836,347,897,1542,1078,1107
,1081,2
43,662,1545,1136,454,318,675,618,898,781,376,428,
665,736,567,840,625,238,1159,1102,1313,1218,1109,1300,15
46,1082,359,457,399,787,591,678,434,677,1192,1163
,1123,1110,349,245,458,666,620,363,127,191,782,40
7,436,62
6,1084,1304,1113,1314,1553,1548,571,465,1220,116
5,681,246,707,350,1125,1171,1200,1166,599,668,790
,460,155
4,1345,1055,1224,249,682,1114,1569,573,411,803,78
9,709,365,440,628,689,374,423,466,793,250,371,481,
1316,13
46,1556,1287,1173,1126,1129,1328,574,413,603,366,
468,655,900,805,1320,1187,1116,1071,1291,1409,15
70,1348,
615,684,710,429,1232,1410,794,252,373,605,848,690
,1174,1177,713,632,482,806,427,904,414,223,1189,1
130,663,
692,835,619,1079,1352,1560,1601,472,455,796,809,1
572,1137,1178,1103,714,721,1293,1132,837,716,864,
810,606 ,912,722,696,1602,1248,1190,1543,377,435,
817,319,621,812,484,430,838,667,1576,1219,1294,16
65,1547,1299,48
8,239,378,459,622,627,1604,1315,1083,1193,437,380
,818,461,496,669,679,724,841,629,1584,1138,1301,1
180,111
1,1221,351,467,438,737,251,462,442,441,1140,1194,
1085,1555,1549,1666,1305,1302,1550,1201,469,247,
683,842,
1317,1412,738,899,670,783,849,820,728,928,791,367
,901,630,1115,1608,685,844,1793,1222,633,711,1196
,1144,1
225,1360,253,691,1086,1306,1167,1127,824,902,120
2,1318,1117,1668,686,740,850,375,444,470,483,415,
1226,161
6,1347,1416,485,905,1321,1794,795,473,1131,1204,1
175,1233,1308,1672,1118,1228,634,744,852,960,132
2,1424,1
632,1376,1349,1557,1179,1234,865,693,1329,1571,1
324,1133,1208,1558,1561,1139,797,906,715,807,119
1,1249,1
350,1330,474,636,694,254,717,575,913,798,1796,118
1,1680,1353,811,379,697,431,607,489,866,723,486,9
08,1134,
1141,718,813,476,856,839,725,1236,1195,1800,1354,
698,914,752,868,819,814,439,929,1250,1573,490,623
,671,73
9,916,463,843,381,497,930,1562,1411,1332,1240,144
0,1295,1303,1182,1361,1574,1696,1142,1356,1603,1
564,141
3,1197,1145,1577,1223,821,726,1808,1203,1252,136
2,1336,1728,961,872,1414,1198,492,631,1578,1605,7
29,700,4
43,741,1417,1307,1146,1472,1377,1585,1227,1087,8
45,920,382,822,1364,1418,1551,1606,1580,1205,131
9,1309,1
256,1148,851,730,498,880,742,445,471,635,1229,120
6,1667,1586,1310,1609,932,687,1323,1378,903,825,5
00,846,
745,826,1235,1425,1209,1420,732,446,962,936,475,8
53,1368,1610,867,637,907,487,1669,1617,1559,1264,
695,746 ,1230,1119,828,753,1351,1588,854,857,1824
,1426,1380,1331,1325,1441,504,799,255,964,1237,15
92,1856,1612,90
9,719,1210,1670,1428,1251,1920,1618,477,915,638,7
48,1442,1326,1673,1795,944,869,491,699,754,858,13
84,1563 ,478,968,383,910,815,976,1135,1355,870,91
7,1238,1333,727,493,873,701,1212,1473,1241,1432,1
633,1620,1575,1
674,1253,1183,1444,1334,931,756,1565,1797,860,49
9,731,823,1634,1681,1357,1143,1624,1363,1242,139
2,1676,1
254,922,874,1415,1337,918,502,1474,1566,933,743,7
60,881,1358,1257,1579,1798,1199,1147,1682,1636,4
94,702,9
21,501,1365,1801,1244,1338,1448,1419,1697,1607,1
379,1311,1207,1258,1149,1581,1684,1640,1366,1340
,1265,18
02,1587,1369,1476,1421,876,847,992,447,1427,1231,
733,827,1698,1582,1809,1456,934,882,937,963,1381,
1211,12
60,1688,747,505,855,924,734,829,965,938,1648,1611
,1804,1729,884,506,749,945,1150,1266,966,755,859,
940,158
9,1422,1370,1480,1382,1429,1327,1593,1268,1619,8
30,911,871,639,888,479,1213,1590,946,750,969,508,
861,757,
970,919,875,862,758,948,1700,1385,1730,1613,1239,
1810,1671,1372,1443,1430,1488,1704,1825,1386,161
4,1433,
1594,1812,1621,1596,1243,1335,977,923,1732,1622,
1625,1675,1445,1816,1826,1635,1626,1434,1255,171
2,972,76
1,1677,1272,1393,1214,1388,1678,1683,1359,1504,1
339,1245,1394,877,952,495,703,935,978,883,762,503
,925,878 ,735,1637,1446,1449,1475,993,885,1638,15
67,1259,1436,1367,1396,1799,1341,1246,1450,1477,
1261,1583,1857,1
828,1736,1858,1685,1832,1803,939,994,1641,1628,1
457,1744,980,926,1840,1860,1371,1921,1267,1686,1
478,1342 ,1699,1642,764,941,1922,1805,967,886,140
0,1452,831,947,1689,1760,1591,1864,507,889,1649,1
262,1383,1481,14
23,1811,984,751,1615,1702,1458,1701,1373,1269,14
82,1690,1644,1387,1151,1215,1806,1431,1460,1650,
1595,148
9,942,996,1705,1270,971,890,1731,1374,1623,1692,1
814,1484,1273,1706,509,949,1597,1435,973,1000,89
2,950,18
27,1813,1733,1389,1464,1652,1713,1398,1447,1490,
863,759,1817,1274,1395,1505,1598,1437,1008,510,1
627,1390 ,1492,1679,1924,1829,979,953,1639,1708,1
734,1453,1818,1276,763,974,1397,1629,1872,1714,9
54,879,981,982,17
37,1656,1506,1830,1451,1928,1438,1247,1687,1716,
927,995,1859,1643,1496,1479,1820,1833,1738,1745,
765,956,
1861,1740,1888,1834,887,985,1630,1936,1746,1720,1401,1459,1841,1343,997,986,1645,1836,1508,1454,1862,1691,1512,1263,1402,1483,1646,1651,943,891,1461,1404,998,766,1842,1485,1520,1693,1703,1748,511,988,1865,1653,1375,1491,1462,1761,1275,1486,1466,1465,1001,951,1493,1271,1707,1866,1762,1923,1002,893,1694,1807,975,894,1873,1844,1752,1952,1815,1391,1925,1654,1709,1868,1657,1735,1009,955,1277,1715,1848,1926,1710,1764,1874,1399,1468,1494,1004,1010,1507,1439,1509,1929,1819,1497,1658,1768,1876,1984,957,983,1889,1717,1821,1930,1739,1831,1498,1660,958,987,1718,1278,1741,1599,1012,999,1937,1822,1835,1403,1721,1455,1016,767,1631,1513,1890,1747,1510,1932,1742,1837,1500,1880,1863,1749,1722,1938,989,1003,1776,1892,1843,1838,1463,1953,1514,1647,1695,1763,1940,1487,1867,1405,990,1005,1521,1954,1845,1750,1985,1896,1516,1655,1753,1724,1467,1765,1869,1944,1406,1846,1875,1754,1522,1904,1766,1469,959,1011,1495,1659,1956,1711,1927,1849,1013,895,1524,1870,1769,1850,1756,1470,1986,1960,1499,1877,1891,1661,1931,1511,1719,1770,1852,1777,1878,1881,1528,1823,1279,1988,1933,1743,1501,1939,1006,1014,1662,1772,1968,1893,1515,1723,1778,1882,1502,1992,1017,1018,1407,1934,1839,2000,1894,1941,1751,1517,1897,1725,1955,1780,1884,1523,1755,1847,1946,1898,1942,1526,1957,1767,1784,1905,1518,1726,1945,1525,1900,1871,991,1020,2016,1471,1757,1851,1958,1906,1961,1987,1771,1529,1879,1948,1758,1853,1007,1015,1989,1962,1908,1530,1773,1969,1990,1779,1883,1964,1854,1935,1895,1663,1912,1503,1019,1021,1970,1774,1993,1532,1885,1781,1994,1943,1899,1886,1782,1972,2001,1947,1996,1785,1901,1976,1519,1727,1959,2002,1907,1786,1527,1949,1902,1759,2017,1909,1963,2018,2004,1950,1788,1965,1991,1910,1855,1971,1022,1023,1531,1913,2008,1775,1966,2020,1995,1914,1533,1973,1997,2024,1916,1974,1887,1783,2032,1534,2003,1977,1787,1998,1978,1903,2005,2006,1951,2019,1789,1980,1911,2009,2021,2010,1967,1915,2022,1790,1535,2012,2025,1975,2026,1917,1999,1918,2033,1979,2028,2034,1981,2007,1982,2011,2036,2023,2040,1791,2013,2027,2014,2029,1983,2035,2037,1919,2030,2038,2041,2042,2015,2044,2031,2039,2043,2045,2046,2047]

**Sequence group 1: Z1_2048**

[0,1,2,7,3,8,11,24,4,10,13,28,16,33,35,78,5,12,14,32,19,38,47,82,22,46,42,91,59,99,107,174,6,17,21,40,23,45,51,93,29,57,61,100,73,114,119,189,34,63,76,117,81,128,143,202,90,145,155,228,160,240,262,369,9,18,26,56 ,30,60,72,109,36,77,64,122,85,133,149,209,44,75,89,144,95,152,159,236,103,162,176,252,188,270,286,417,53,92,101,158,115,168,183,267,126,184,201,278,211,299,318,452,147,207,231,307,238,319,341,477,259,347,364,497,385,516,552,728,15,25,31,74,39,80,83,148,48,88,96,157,106,167,171,266,58,97,108,169,118,182,198,282,132,199,208,294,233,313,337,469,66,112,127,187,136,200,216,308,156,229,239,321,258,346,359,496,170,247,268,351,279,375,387,514,304,402,432,541,456,568,625,729,70,129,151,219,166,237,255,349,175,260,272,368,287,386,416,533,194,283,295,396,320,428,454,576,331,462,480,596,504,634,654,825,213,309,324,435,352,468,483,618,384,493,515,646,546,657,701,877,415,524,553,684,566,723,745,921,623,760,777,906,811,950,1021,1196,20,37,41,94,49,98,110,181,50,111,123,190,140,210,222,335,65,124,141,225,153,232,245,336,161,244,263,363,284,383,390,513,68,150,163 ,227,178,248,269,382,186,276,288,394,298,426,445,564,185,296,311,425,330,455,471,597,354,485,505,633,523,653,689,863,79,173,179,274,193,292,310,418,203,315,323,453,342,476,492,629,261,338,353,479,370,502,522,648,404,529,558,678,583,722,747,902,291,366,395,512,424,540,562,710,450,571,589,727,626,769,791,935,481,624,635,778,649,812,773,965,694,860,878,1031,887,1069,1122,1228,84,191,195,329,249,345,358,484,275,362,371,507,403,531,555,712,289,397,423,532,434,563,585,731,463,591,615,765,647,789,824,969,334,427,444,584,470,610,641,774,506,642,655,822,695,807,867,1033,539,674,716,861,732,886,904,1058,770,909,908,1110,966,1139,1163,1323,365,457,488,643,530,656,688,837,559,711,724,879,755,889,907,1067,586,741,775,903,792,920,967,1140,836,979,1018,1166,1044,1210,1226,1377,632,779,820,968,866,974,1038,1173,876,1035,1062,1220,1104,1239,1292,1444,890,1070,1136,1259,1154,1295,1277,1450,1194,1341,1353,1512,1383,1554,1581,1668,27,43,52,102,62,125,14

2,217,67 ,146,154,224,165,242,246,372,69,164,172,241,180,293,305,414,204,306,328,451,344,472,489,645,71,177,192,297,206,325,339,466,218,348,360,494,374,517,537,658,230,367,389,528,419,554,569,698,429,565,592,740,595,764,788,1023,113,205,212,343,226,361,373,509,253,391,405,549,431,575,590,714,273,411,437,567,465,594,603,752,478,604,614,790,673,813,852,1034,290,464,474,613,501,640,644,804,519,672,691,831,726,864,880,1063,548,700,733,881,771,895,937,1105,819,944,988,1141,1019,1171,1212,1375,116,223,243,388,271,410,433,582,285,446,467,605,482,622,627,793,314,475,500,628,518,669,685,828,547,696,725,869,753,891,928,1064,340,508,536,690,570,717,715,892,587,744,761,922,805,940,962,1149,619,772,815,951,829,1001,1020,1178,855,1032,1052,1221,1109,1241,1293,1445,355,551,574,746,602,768,806,945,667,818,844,1012,849,1022,1042,1203,675,845,854,1037,893,1047,1093,1238,932,1108,1135,1260,1162,1326,1344,1453,697,905,926,1065,963,1111,1138,1281,989,1156,1179,1340,1213,1354,1381,1521,1054,1183,1222,1359,1255,1385,1390,1573,1282,1429,1449,1596,1498,1626,1661,1755,137,254 ,277,447,312,473,495,652,322,503,525,671,550,693,730,929,350,538,577,713,593,767,754,934,611,776,810,978,838,1010,1025,1195,422,588,612,766,666,795,821,1013,670,839,851,1030,865,1043,1057,1230,676,862,888,1056,931,1092,1123,1261,956,1153,1157,1327,1182,1345,1372,1506,430,659,668,830,677,848,868,1046,699,894,923,1068 ,941,1120,1155,1321,814,930,964,1134,990,1167,1186,1342,1045,1187,1223,1360,1258,1384,1389,1572,850,1000,1036,1170,1055,1219,1234,1374,1101,1240,1273,1388,1320,1442,1452,1603,1137,1283,1333,1448,1352,1459,1503,1632,1376,1513,1545,1657,1560,1689,1693,1819,436,679,692,927,794,936,957,1152,823,975,1011,1172,1039,1202,1229,1373,853,1024,1053,1211,1066,1235,1276,1387,1121,1294,1272,1415,1343,1451,1487,1616,933,1059,1071,1254,1148,1280,1332,1446,1165,1334,1347,1480,1361,1499,1540,1656,1218,1355,1380,1507,1391,1555,1561,1681,1443,1589,1602,1707,1627,1730,1740,1810,991,1100,1164,1335,1197,1346,1358,1502,1227,1382,1386,1544,1428,1558,1597,1692,1231,1414,1447,1588,1486,1604,1605,1731,1520,1633,1643,1741,1669,1770,1786,1892,1322,1458,1481,1617,1541,1642,1660,1747,1559,1680,1688,1771,1718,1787,1848,1908,1580,1706,1719,1811,1746,1818,1849,1909,1754,1860,1861,1926,1893,1927,1968,1969,54,55,86,121,87,130,135,256,104,134,139,280,214,303,317,490,105,138,196,302,221,332,381,510,250,380,376,535,409,561,581,758,120,215,235,356,251,379,399,543,281,407,413,572,459,608,621,799,316,421,486,617,499,650,681,832,534,683,709,884,734,912,952,1119,131,220,264,406,300,412,458,599,326,487,438,630,521,661,703,843,378,461,527,682,545,706,721,900,579,736,762,938,798,960,986,1181,401,542,573,720,609,748,785,955,638,786,827,980,847,1005,1040,1232,687,841,897,1009,910,1041,1083,1265,947,1089,1114,1289,1133,1308,1356,1532,197,257,301,460,333,498,511,702,392,526,556,719,580,743,751,954,408,557,598,749,620,784,816,982,660,817,842,998,899,1027,1079,1251,440,606,639,797,662,826,858,1014,718,885,911,1049,946,1088,1103,1288,750,919,958,1095,981,1129,1143,1306,1006,1160,1204,1337,1242,1378,1433,1533,448,651,705,871,742,901,943,1091,759,948,970,1118,987,1142,1180,1325,808,983,999,1158,1048,1198,1236,1396,1075,1244,1268,1412,1298,1440,1468,1613,857,1015,1060,1207,1096,1250,1271,1426,1132,1285,1307,1462,1338,1471,1515,1651,1177,1314,1357,1492,1370,1527,1543,1683,1431,1552,1575,1676,1595,1708,1743,1842,234,327,357,544,393,560,600,783,398,601,631,800,664,846,872,1077,439,636,665,875,707,898,917,1078,735,916,953,1113,984,1131,1146,1305,442,704,737,883,780,924,959,1130,796,976,992,1150,1004,1192,1215,1368,787,1002,1017,1191,1074,1237,1253,1413,1098,1275,1299,1439,1313,1467,1495,1641,491,757,781,972,803,996,1016,1184,833,1029,1051,1233,1084,1264,1284,1437,949,1080,1097,1267,1124,1296,1312,1464,1168,1317,1364,1490,1399,1526,1547,1672,995,1116,1151,1304,1190,1336,1366,1516,1224,1393,1405,1531,1434,1565,1583,1699,1269,1432,1441,1576,1465,1598,1569,1715,1504,1638,1652,1751,1659,1785,1802,1862,520,801,809,1073,925,1087,1102,1274,973,1112,1125,1301,1161,1319,1363,1518,993,1159,1189,1324,1206,1367,1401,1535,1245,1407,1425,1557,1463,1579,1612,1721,1076,1193,1214,1400,1252,1420,1455,1570,1300,1456,1469,1610,1505,1593,1647,1753,1331,1484,1524,1639,1536,1658,1674,1776,1566,1679,1678,1798,1716,1809,1825,1895,1115,1243,1278,1457,1318,1470,1494,1621,1365,1517,1528,1653,1551,1663,1677,1783,1402,1539,1571,1673,1584,1682,1717,1812,1620,1725,1738,1828,1764,1846,1858,1925,1438,1577,1608,1720,1646,1722,1760,1833,1650,1757,1778,1854,1794,1869,1886,1946,1664,1788,1806,1875,1820,1889,1881,1952,1840,1903,1913,1970,1931,1978,1987,2008,265,377,400,578,420,637,680,859,441,686,708,874,739,914,918,1126,443,738,756,913,782,997,1007,1176,834,1008,1072,1225,1086,1256,1279,1461,449,763,802,1003,840,1061,1081,1248,870,1090,1106,1286,1128,1309,1329,1472,896,1117,1145,1316,1185,1362,1379,1510,1199,1369,1408,1538,1411,1556,1578,1745,607,835,856,1085,882,1107,1127,1303,939,1147,1169,1349,1201,1395,1406,1522,971,1175,1209,1371,1247,1410,1417,1548,1266,1418,1424,1582,1483,1599,1634,1756,994,1246,1262,1423,1291,1454,1460,1590,1311,1482,1497,1619,1530,1644,1654,1779,1348,1514,1537,1655,1567,1671,1701,1795,1607,1704,1726,1813,1739,1831,1850,1923,616,873,915,1144,961,1174,1205,1398,985,1216,1249,1419,1270,1430,1435,1585,1028,1263,1290,1436,1310,1477,1493,1614,1339,1508,1529,1649,1549,1665,1690,1780,1082,1302,1328,1496,1392,1525,1523,1666,1403,1542,1553,1684,1591,1702,1712,1815,1427,1568,1601,1709,1615,1733,1742,1834,1637,1752,1768,1855,1797,1871,1887,1947,1099,1351,1394,1546,1416,1564,1592,1705,1475,1606,1624,1736,1629,1744,1762,1845,1485,1625,1636,1759,1667,1767,1791,1868,1696,1796,1805,1876,1824,1896,1906,1955,1509,1675,1686,1781,1713,1799,1808,1883,1727,1822,1835,1902,1851,1914,1929,1973,1772,1837,1856,1917,1873,1933,1938,1985,1884,1943,1951,1990,1962,1998,2007,2027,663,942,977,1217,1026,1257,1287,1466,1050,1297,1315,1479,1350,1501,1534,1691,1094,1330,1397,1519,1409,1563,1550,1698,1421,1574,1594,1724,1622,1734,1749,1841,1188,1404,1422,1562,1474,1587,1609,1737,1478,1623,1631,1750,1645,1763,1775,1864,1488,1640,1662,1774,1695,1790,1803,1877,1710,1817,1823,1897,1836,1907,1920,1966,1200,1473,1476,1618,1489,1628,1648,1766,1511,1670,1685,1784,1703,1800,1821,1891,1600,1694,1714,1804,1728,1829,1838,1904,1765,1839,1857,1918,1874,1932,1937,1984,1630,1732,1758,1830,1773,1853,1866,1922,1793,1870,1879,1936,1890,1944,1954,1993,1807,1885,1899,1950,1912,1957,1965,2000,1924,1971,1977,2005,1982,2013,2015,2035,1208,1491,1500,1687,1586,1700,1711,1816,1611,1723,1735,1832,1761,1844,1863,1921,1635,1748,1769,1847,1782,1867,1880,1935,1801,1888,1878,1941,1905,1953,1961,1996,1697,1777,1789,1872,1814,1882,1898,1948,1827,1900,1911,1958,1919,1963,1974,2004,1852,1915,1928,1967,1939,1979,1983,2011,1945,1989,1992,2017,1999,2020,2022,2032,1729,1792,1826,1901,1843,1910,1916,1964,1859,1930,1934,1976,1942,1980,1991,2014,1865,1940,1949,1988,1960,1994,1995,2021,1972,2001,2003,2023,2009,2028,2030,2040,1894,1956,1959,1997,1975,2002,2006,2025,1981,2010,2012,2029,2018,2031,2036,2042,1986,2016,2019,2033,2024,2034,2037,2043,2026,2038,2039,2044,2041,2045,2046,2047]

**Sequence group 1: QI_4096**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,1024,1025,67,41,144,28,69,42,516,49,74,272,160,520,288,528,192,544,70,44,131,81,50,73,15,320,133,52,23,134,384,76,1026,1028,137,82,56,27,97,39,259,84,138,145,261,29,43,98,515,88,1032,1040,140,30,2048,2049,2050,2052,146,71,262,265,161,576,45,100,640,51,148,46,1056,1027,75,266,273,517,104,162,53,193,1029,1088,152,77,1033,1030,164,768,1041,1034,268,274,518,54,83,57,521,112,135,78,289,194,85,276,522,58,168,139,99,86,60,280,89,290,529,524,196,141,2056,2064,2080,2051,101,147,176,142,530,321,31,200,90,545,292,322,532,263,149,102,105,304,296,163,92,47,267,385,546,324,208,386,1042,1152,150,153,2053,2112,2057,2054,165,106,55,328,536,577,548,113,154,79,269,108,578,224,1036,1057,166,519,552 ,195,1089,1044,270,641,523,275,580,291,2065,2058,2066,2176,59,169,560,114,277,156,1280,1058,87,197,116,170 ,61,531,525,642,2060,2081,2113,2068,281,278,526,177,2304,2082,2072,2084,293,388,10

48,1060,2055,2177,2114, 2560,91,584,769,198,1031,1153,172,120,201,336,62, 282,1090,1536,143,103,178,294,93,644,202,592,323, 392,297, 770,107,180,1035,1064,151,209,284,648,94,204,298, 400,608,352,325,533,155,210,305,547,300,109,1092, 1154,104 3,1037,184,534,537,115,167,225,326,306,772,157,65 6,329,1072,1038,110,117,212,171,776,330,226,549,1 096,1281 ,538,387,308,216,1045,1156,416,271,279,1 58,337,550,672,118,332,579,540,389,173,121,553,19 9,784,179,228,338, 312,704,1059,1282,390,174,554,581,393,283,2059,20 88,2116,2178,122,448,353,561,203,63,340,394,527,5 82,556,1 81,1050,1537,1104,1061,1049,1046,295,285,232,124, 205,182,643,562,286,585,1160,1284,299,354,2067,20 61,2096 ,2062,211,401,1288,1062,1538,1120,185,396 ,2120,2305,2069,2180,344,586,1091,1065,1168,1052, 645,593,1093,10 66,535,240,206,95,327,564,1540,1073,800,402,356,3 07,301,417,2083,2306,2074,2561,213,568,832,588,18 6,646,40 4,227,896,594,1098,1296,1184,1544,1312,1552,418,3 02,649,771,1216,1568,360,539,111,331,214,309,2128 ,2085,2 073,2070,188,449,1094,1068,1155,1105,217,408,218 4,2308,2312,2086,609,596,551,650,229,159,420,310, 541,773, 610,657,2562,2144,3072,3073,333,119,600,339,218,3 68,652,230,391,313,1074,1097,450,542,1039,1344,33 4,233,5 55,774,175,123,1157,1076,658,612,341,777,2115,208 9,2192,2076,220,314,424,395,673,583,1047,1158,355 ,287,18 3,234,125,557,660,616,1408,1100,342,316,241,778,1 161,1106,563,345,452,397,403,207,1080,1051,674,55 8,785,43 2,2117,2090,2564,2097,2122,2320,2208,2568,357,18 7,1121,1063,1283,1108,236,664,624,587,780,705,126 ,242,565 ,398,1162,1169,346,456,1285,1053,358,405, 2336,2576,2240,2592,303,569,244,595,189,566,676,3 61,1067,1122,70 6,589,215,786,1539,1112,2118,2092,2179,2129,1164, 1054,647,348,419,406,464,680,2098,2121,2063,2368, 801,362 ,590,409,570,788,597,572,219,311,1170,109 5,1286,1289,708,598,601,651,1185,1600,1069,1124,4 21,792,802,611,6 02,410,1664,1075,231,688,1172,1070,653,248,369,19 0,364,654,659,335,1099,1290,2181,2100,2071,2182,4 80,315, 221,370,1297,1541,1128,1186,613,422,425,451,614,5 43,235,412,343,372,1077,1217,775,317,222,426,453, 237,559, 833,1176,1101,1188,1792,1292,1298,804,712,2432,2 124,3074,3076,2185,2130,2104,2075,2145,2087,2307 ,2132,83 4,661,808,779,617,604,433,720,816,836,347,897,154 2,1078,1107,1081,243,662,1545,1136,2186,2193,230 9,2077,4 54,318,675,618,898,781,376,428,2091,2146,2563,213 6,3080,3088,2188,2078,665,736,567,840,625,238,115 9,1102, 2194,2119,2310,2313,2209,2624,2093,2148,1313,121 8,1109,1300,2688,2099,2196,2094,1546,1082,359,45 7,399,78 7,591,678,434,677,1192,1163,3104,3075,2123,2314,1 123,1110,349,245,458,666,620,363,127,191,782,407, 436,626, 1084,1304,1113,1314,1553,1548,571,465,1220,1165, 681,246,707,350,1125,1171,1200,1166,2321,2565,21 52,2210, 2101,2241,3077,3136,2200,2125,3081,3078,599,668, 790,460,1554,1345,1055,1224,2212,2816,3089,3082, 249,682, 1114,1569,573,411,803,789,709,365,440,628,689,374 ,423,466,2316,2322,2566,2102,2131,2105,2569,2160, 793,250 ,371,481,1316,1346,1556,1287,1173,1126,11 29,1328,574,413,603,366,468,655,900,805,1320,1187 ,1116,1071,1291 ,1409,1570,1348,615,684,710,429,1 232,1410,794,252,373,605,848,690,1174,1177,713,63 2,482,806,427,904,2183,2 126,2337,2242,414,223,1189,1130,2133,2324,2570,2 106,663,692,835,619,1079,1352,1560,1601,472,455,7 96,809,2 216,2187,2147,2134,1572,1137,1178,1103,714,721,1 293,1132,837,716,864,810,606,912,722,696,1602,124 8,1190,1 543,2108,2328,2137,2338,377,435,817,319,621,812,4 84,430,838,667,1576,1219,1294,1665,1547,1299,257 7,2572,2 244,2189,488,239,378,459,622,627,1604,1315,2149,2 195,2224,2190,1083,1193,437,380,818,461,496,669,6 79,724, 841,629,2578,2369,2079,2248,1584,1138,1301,1180, 1111,1221,351,467,438,737,251,462,2138,2593,2340, 2370,25 80,2311,2197,2150,442,441,1140,1194,1085,1555,15 49,1666,1305,1302,1550,1201,469,247,683,842,1317, 1412,73 8,899,2153,2352,2344,2211,670,783,849,820,2140,20 95,2315,2433,728,928,791,367,901,630,1115,1608,68 5,844,1 793,1222,633,711,1196,1144,1225,1360,253,691,259 4,2372,2256,2434,1086,1306,1167,1127,824,902,120 2,1318,3 090,3200,2198,2201,2213,2154,2103,2376,1117,1668 ,686,740,850,375,444,470,483,415,1226,1616,1347,1 416,485, 905,1321,1794,795,473,1131,1204,1175,1233,1308,1 672,1118,1228,634,744,852,960,2584,2625,2596,216 1,2202,2 127,2317,2156,1322,1424,1632,1376,1349,1557,1179 ,1234,2626,2272,3084,3105,2214,2567,2600,2243,86 5,693,13 29,1571,1324,1133,1208,1558,1561,1139,797,906,31

37,3092,2318,2689,715,807,1191,1249,2571,2323,2628,2339,1350,1330,474,636,694,254,717,575,913,798,1796,1181,1680,1353,811,379,2107,2217,2608,2162,697,431,607,489 ,866,723,486,908,2325,2204,3328,3106,2135,2245,2164,2218,1134,1141,718,813,476,856,839,725,1236,1195,1800 ,1354,698,914,752,868,819,814,439,929,2109,2579,2573,2690,1250,1573,490,623,671,739,916,463,843,381,497,930,1562,1411,1332,1240,2329,2326,2574,2225,2341,2436,3096,3108,2139,2632,2817,2246,1440,1295,1303,1182,1361,1574,1696,1142,1356,1603,1564,1413,1197,1145,1577,1223,821,726,1808,1203,1252,1362,1336,1728,961,872,1414,1198,3079,3201,2220,2168,2249,2384,2110,2330,492,631,1578,1605,3138,3584,2191,2151,729,700,443,741,1417,1307,1146,1472,1377,1585,1227,1087,845,920,382,822,1364,1418,1551,1606,1580,1205,1319,1309,1256,1148,851,730,2226,2342,2141,2692,2250,2640,2371,2440,2345,2818,2155,2228,3083,3112,2199,2257,498,880,742,445,471,635,1229,1206,1667,1586,1310,1609,932,687,1323,1378,2332,2696,2142,2252,2346,2448,2656,2400,903,825,500,846,745,826,1235,1425,1209,1420,732,446,962,936,475,853,1368,1610,867,637,907,487,1669,1617,2373,2581,2203,2258,2353,2595,2348,2157,3140,3202,3091,3085,1559,1264,695,746,2232,2582,2585,2163,1230,1119,828 ,753,1351,1588,854,857,2215,2273,2374,2354,2820,2205,2704,2377,1824,1426,1380,1331,1325,1441,504,799,3120,3086,2158,2165,2260,2219,2824,2378,255,964,1237,1592,2274,2597,3144,3329,1856,1612,909,719,1210,1670,1428,1251,1920,1618,477,915,638,748,1442,1326,1673,1795,944,869,491,699,754,858,1384,1563,478,968,383,910,815,976,2586,2435,2356,2264,3093,3204,2464,2319,2327,2206,2385,2598,2720,2166,2380,2627,1135,1355,870,917,1238,1333,727,493,873,701,1212,1473,1241,1432,1633,1620,2588,2437,2221,2169,2601,2247,2832,2227,2276,2386,2360,2752,3107,3330,2438,2222,1575,1674,1253,1183,1444,1334,931,756,2602,2629,2441,2331,1565,1797,860,499,731,823,1634,1681,1357,1143,1624,1363,2170,2496,2401,2609,1242,1392,1676,1254,922,874,1415,1337,918,502,1474,1566,933,743,760,881,2251,2111,2388,2442,1358,1257,1579,1798,1199,1147,1682,1636,2575,2630,2604,2229,3098,3585,3152,3109,494,702,921,501,1365,1801,1244,1338,3097,3094,2343,2333,2280,2172,2253,2230,1448,1419,1697,1607,2691,2610,2334,2633,1379,1311,1207,1258,1149,1581,1684,1640,1366,1340,1265,1802,1587,1369,1476,1421,3208,3332,2347,2402,2259,2449,3336,3110,876,847,992,447,1427,1231,733,827,1698,1582,1809,1456,934,882,937,963,1381,1211,1260,1688,3586,3168,2233,2444,2392,2634,3139,3113,3216,3100,2693,2641,747,505,855,924,734,829,965,938,1648,1611,1804,1729,3141,3114,2583,2288,2254,2143,2375,2612,884,506,749,945,1150,1266,966,755,859,940,1589,1422,1370,1480,1382,1429,1327,1593,1268,1619,3588,3121,2848,2450,2404,2355,2349,2465,2261,2616,2880,2636,830,911,871,639,888,479,1213,1590,946,750,969,508,861,757,970,919,2234,2694,2452,2275,2944,2642,3146,3344,3232,3592,3360,3600,2466,2350,2697,2819,3264,3616,2408,2587,875,862,758,948,1700,1385,1730,1613,2159,2379,2262,2357,1239,1810,1671,1372,1443,1430,1488,1704,1825,1386,1614,1433,1594,1812,1621,1596,1243,1335,977,923,1732,1622,1625,1675,2236,2497,3142,3116,1445,1816,1826,1635,3203,3153,2265,2456,1626,1434,1255,1712,2657,2644,2599,2698,2277,2207,2468,2358,972,761,1677,1272,2589,2821 ,2658,2705,2381,2167,2648,2387,1393,1214,1388,1678,2266,2416,2700,2278,2439,2361,3122,3145,1683,1359,1504,1339,1245,1394,877,952,495,703,935,978,883,762,503,925,2498,2590,3087,3392,2382,2281,2603,2822,878,735,1637,1446,2223,2171,3205,3124,1449,1475,993,885,2706,2660,2389,2825,2268,2362,2472,2443,2721,2631,3095,3206,2403,2335,2231,2282,1638,1567,1259,1436,1367,1396,1799,1341,2173,2605,2708,2664,3456,3148,2390,2364,2289,2826,3209,3154,2611,2393,2500,2445,1246,1450,1477,1261,2451,2255,3128,3099,2722,2606,2833,2480,2405,2235,3169,3111,3331,3156,2284,2712,1583,1857,1828,1736,1858,1685,1832,1803,2672,2635,2828,2753,2174,2290,2613,2446,939,994,1641,1628,1457,1744,980,926,1840,1860,1371,1921,1267,1686,1478,1342,3210,3217,2394,2504,3333,3101,2406,2453,1699,1642,764,941,1922,1805,967,886,1400,1452,831,947,1689,1760,1591,1864,507,889,1649,1262,2351,2617,2292,2643,1383,1481,1423,1811,984,751,1615,1702,1458,1701,1373,1269,2237,2614,2724,2409,3115,3170,2754,2637,1482,1690,1644,1387,1

151,1215,1806,1431,1460,1650,1595,1489,942,996,1705,1270 ,2263,2834,3587,3160,971,890,1731,1374,1623,1692,1814,1484,1273,1706,509,949,1597,1435,973,1000,892,950,1827,1813,3212,3102,2695,2396,2467,2454,2512,2728,2849,2410,2638,2457,2618,2836,2645,2620,2267,2359,3218,3143,3334,3337,2756,2646,2649,2699,3233,3648,3117,3172,2469,2840,2850,2659,2650,2458,3712,3123,2279,2736,1733,1389,1464,1652,3220,3118,2701,2296,2417,2238,2412,2702,2707,2383,3147,3338,1713,1398,1447,1490,2528,2363,2269,2418,863,759,1817,1274,3345,3589,3176,3234,1395,1505,1598,1437,1008,510,1627,1390,2661,2470 ,2473,2499,2662,2591,2283,2460,2391,2420,3125,3265,2823,2365,2270,2474,1492,1679,1924,1829,979,953,1639,1708,2501,2285,2607,2881,3224,3149,3236,3840,3340,3346,2852,2760,2882,2709,2856,2827,2665,2652,2481,2768,1734,1453,1818,1276,763,974,1397,1629,1872,1714,954,879,981,982,1737,1656,2864,2884,2395,2945,3590,3126,3155,3129,2291,2710,3593,3184,1506,1830,1451,1928,2502,2366,2723,2666,1438,1247,1687,1716,927,995,1859 ,1643,1496,1479,1820,1833,2946,2829,2424,2476,2713,2784,2615,2888,1738,1745,765,956,1861,1740,1888,1834,887,985,1630,1936,2673,2286,3207,3150,1746,1720,1401,1459,1841,1343,997,986,3361,3266,3157,3348,3594,3130,2407,2505,1645,1836,1508,1454,2447,2835,2639,2726,1862,1691,1512,1263,2482,2725,3240,3211,1402,1483,1646,1651,3171,3158,2397,2293,2506,2714,2668,2411,2175,2239,2830,2455,943,891,1461,1404,998,766,1842,1485,2484,2674,3132,3352,3161,3362,3601,3596,1520,1693,1703,1748,2619,2513,3268,3213,2729,2294,2755,2398,3173,3219,3248,3214,511,988,1865,1653,1375,1491,1462,1761,2647,2716,2838,2508,3602,3393,3103,3272,1275,1486 ,1466,1465,1001,951,1493,1271,1707,1866,1762,1923,2297,2730,3162,3617,1002,893,1694,1807,975,894,1873,1844,1752,1952,1815,1391,2621,2459,2851,2837,1925,1654,1709,1868,2757,2413,2488,2676,1657,1735,1009,955,1277,1715,1848,1926,2737,2422,2471,2514,2841,2298,2419,2529,3364,3394,3604,3335,3221,3174,3177,3376,2622,2461,2651,2414,2516,2703,2948,2853,1710,1764,1874,1399,3368,3235,3164,3119,1468,1494,1004,1010,1507,1439,1509,1929,3339,3457,3618,3396,2663,2732,2758,2477,3280,3458,2842,2300,2421,2653,2896,2738,3222,3225,2761,2680,1819,1497,1658,1768,2530,2854,2475,2952,1876,1984,957,983,2462,2271,3237,3178,1889,1717,1821,1930 ,1739,1831,1498,1660,2711,2740,2883,2667,3127,3400,3608,3649,2520,2503,2844,2857,3620,3185,3226,3151,958 ,987,1718,1278,1741,1599,1012,999,2762,2769,3341,3180,2885,2764,2912,2858,2654,2960,2770,2744,3650,3296,3238,3591,2425,2483,2865,2367,2669,2860,2532,2478,2886,2715,3624,3267,3342,3713,3595,3347,2536,2287,2426,2507,2670,2675,3652,3363,3131,3241,2485,2428,2866,2509,2544,2717,1937,1822,1835,1403,1721,1455,1016,767,2727,2772,2889,2677,1631,1513,1890,1747,3632,3186,3349,3228,3159,3269,2399,2515,1510,1932,1742,1837,1500,1880,1863,1749,2486,2785,2299,2510,2490,2489,3188,3242,1722,1938,989,1003,1776,1892,1843,1838,1463,1953,1514,1647,1695,1763,1940,1487,3133,3603,3597,3714,3353,3350,3598,3249,1867,1405,990,1005,1521,1954,1845,1750,2517,2295,2731,2890,1985,1896,1516,1655,1753,1724,1467,1765,3365,3460,2786,2947,2718,2831,2897,2868,2776,2976,2839,2415,2949,2678,3163,3656,2733,2892,3841,3270,1869,1944,1406,1846,1875,1754,1522,1904,1766,1469,959,1011,2681,2759,3244,3192,1495,1659,1956,1711,1927,1849,1013,895,1524,1870,1769,1850,1756,1470,1986,1960,1499,1877,1891,1661,1931,1511,1719,1770,3273,3408,2301,2739,3134,3354,3215,3175,2872,2950,3250,3366,3165,3716,2734,2788,2898,2423,2492,2518,2531,2463,3274,3664,3395,3464,2533,2953,3369,3842,2843,2521,3179,3252,3223,3281,3356,3720,3166,3276,2682,2792,2900,3008,1852,1777,1878,1881,3370,3472,3680,3424,3397,3605,3227,3282,2913,2741,3377,3619,3372,3181,3256,3606,3609,3187,2845,2954,2763,2855,3239,3297,1528,1823,1279,1988,3398,3378,2522,2684,2742,2302,2765,2623,2961,2846,3844,3229,3728,3401,2859,2427,2745,2479,2655,2537,2914,2771,2534,2956,1933,1743,1501,1939,1006,1014,1662,1772,1968,1893,1515,1723,1778,1882,1502,1992,1017,1018,1407,1934,1839,2000,1894,1941,3182,3189,2766,2861,2524,2904,2887,2773,1751,1517,1897,1725,3284,3243,3848,3402,2746,2962,2800,2916,2867,2862,2487,2977,3298,3621,2538,2671,2719,2787,2964,2511,2891,2429,2545,2978,3610,3459,3380,3288,3488,3343,3351,3230,3409,3622,3744,3190,3404,3651,3612,3461, 1955,1780,1884,1523,3245,3193,3625,3271,2869,277
4,3856,3251,1755,1847,1946,1898,3300,3410,3384,3
776,300
9,2920,3462,3246,2540,2679,3626,3653,2777,2748,2
491,2789,3465,3355,3194,3520,1942,1526,1957,1767
,3425,36
33,3275,3135,1784,1905,1518,1726,2893,2968,2430,
2870,1945,1525,1900,1871,3412,3466,3599,3654,362
8,3253,3
367,3357,991,1020,2016,1471,3304,3196,2899,2778,
2546,2928,2790,2493,2519,2683,3277,3254,1757,185
1,1958,1
906,3715,3634,3358,3657,2980,2735,3371,3426,2951
,2873,2548,2894,2793,2874,3283,3473,3257,3468,27
80,2494,
3010,2984,2523,2901,3416,3658,2915,2685,2955,253
5,3717,3665,3607,3312,2743,2794,1961,1987,1771,1
529,327
8,3167,2876,2801,1879,1948,1758,1853,3399,3636,2
902,2905,3872,3474,3428,3379,3373,3489,2552,2847
,2303,30
12,3285,3640,1007,1015,1989,1962,3904,3660,2957,
2767,1908,1530,1773,1969,1990,1779,1883,1964,325
8,3718,3
476,3299,3968,3666,2525,2963,2686,2796,3490,3374
,3721,3843,2992,2917,2539,2747,2802,2906,1854,19
35,1895,
1663,3432,3611,2526,3016,2431,2958,2863,3024,318
3,3403,2918,2965,1912,1503,1019,1021,3286,3381,2
775,254
1,2921,2749,3260,3521,3289,3480,3681,3668,1970,1
774,1993,1532,3623,3722,3301,3231,3492,3382,2979
,2804,36
13,3845,2908,2547,1885,1781,1994,1943,2779,2871,
3682,3729,3405,3191,3672,3411,1899,1886,1782,197
2,2001,1
947,1996,1785,3290,3440,3724,3302,2970,2922,3463
,3385,2966,2550,3522,3614,2981,2791,2808,2929,34
06,3305,
3627,3846,1901,1976,1519,1727,3247,3195,3730,368
4,2542,2750,2969,2549,3413,3849,3292,3386,3496,3
467,374
5,3655,1959,2002,1907,1786,3427,3359,3255,3306,3
197,3629,3732,3688,1527,1949,1902,1759,3414,3388
,3313,38
50,3635,3417,3524,3469,2924,2895,3040,2495,3475,
3279,2781,2875,2017,1909,1963,2018,3746,3630,385
7,3504,2
982,2930,2985,3011,3429,3259,3308,3736,2795,2553
,2903,2972,2782,2877,3013,2986,3696,3659,3852,37
77,2004,
1950,1788,1965,2932,2554,2797,2993,1991,1910,185
5,1971,3198,3314,3014,2803,2907,2988,3637,3470,3
418,352
8,3430,3477,1022,1023,1531,1913,3375,3641,3316,3
667,2878,2959,2919,2687,2936,2527,3261,3638,2994
,2798,30
17,2556,2909,2805,3018,2967,2008,1775,1966,2020,
2923,2910,2806,2996,3748,3433,3778,3661,3287,385
8,3719,3
420,1995,1914,1533,1973,3491,3478,3536,3752,1997
,2024,1916,1974,3873,3434,3662,3481,3642,3860,36
69,3644,
3291,3383,3025,2971,3780,3670,3673,3723,3493,386
4,3874,3683,3674,3482,3303,3760,1887,1783,2032,1
534,302
0,2809,3725,3320,3441,3262,3436,3726,3731,3407,3
552,3387,3293,3442,2925,3000,2543,2751,2983,3026
,2003,19
77,1787,1998,2931,2810,2551,2973,2926,2783,3685,
3494,3497,3523,3041,2933,3686,3615,3307,3484,341
5,3444,3
847,3389,1978,1903,2005,2006,3294,3498,3525,3309
,3631,3905,3876,3784,3906,3733,3880,3851,2987,30
42,3689,
3676,1951,2019,1789,1980,3505,3792,3028,2974,388
8,3908,3419,3969,1911,2009,2021,2010,3315,3734,3
526,339
0,3747,3690,2812,2989,3970,3853,3015,2934,1967,1
915,2022,1790,3448,3500,2879,2995,3737,3808,3639
,3912,25
55,2937,3697,3310,3431,3529,3471,3859,3032,2799,
3663,3750,3506,3749,3421,3317,3530,3738,3692,343
5,1535,2
012,2025,1975,3199,3263,3854,3479,3508,3698,3643
,3537,2990,3044,3753,3318,3019,2938,3779,3422,36
71,3740,
3862,3532,3321,3754,2557,2997,3645,3483,3021,304
8,2026,1917,1999,1918,2940,2998,3875,3861,3781,3
437,351
2,3700,3761,3446,3495,3538,2911,2807,3865,3322,3
443,3553,3646,3485,3056,2558,3675,3438,3540,3727
,3972,38
77,3027,3001,3687,3756,3782,3501,3866,3324,2811,
3022,3445,3677,3920,3762,3002,2927,2033,1979,202
8,2034,3
029,3030,3785,3704,3554,3878,3499,3976,3486,3295
,3735,3764,1981,2007,1982,2011,2975,3043,3907,36
91,3544,
3527,3868,3881,3786,3793,2813,3004,3909,3788,393
6,3882,2935,3033,3678,3984,3794,3768,3449,3507,3
889,339
1,3045,3034,3693,3884,3556,3502,3910,3739,3560,3
311,3450,3531,3694,3699,2991,2939,3509,3452,3046
,2814,38
90,3533,3568,3741,3751,3796,2559,3036,3913,3701,
2036,2023,2040,1791,3423,3539,3510,3809,3323,353
4,3514,3
513,3049,2999,3541,3319,3755,3914,3810,3971,3050
,2941,3742,3855,2013,2027,2014,2029,3023,2942,39
21,3892,
3800,4000,3863,3439,3973,3702,3757,3916,3705,378
3,3057,3003,3325,3763,3896,3974,3758,3812,3922,3
447,351
6,3542,3052,3058,3555,3487,3557,3977,3867,3545,3
706,3816,3924,4032,3005,3031,3937,3765,3869,3978

,3787,3879,3546,3708,3006,3035,3766,3326,3789,3647,3060,3047,3985,3870,3883,3451,1983,2035,2037,1919,3769,3503,3064,2815,3679,3561,3938,3795,3558,3980,3790,3885,3548,3928,3911,3797,3770,3986,3037,3051,3824,3940,3891,3886,3511,4001,3562,3695,2030,2038,2041,2042,3743,3811,3988,3535,3915,3453,3038,3053,3569,4002,3893,3798,4033,3944,3564,3703,3801,3772,3515,3813,3917,3992,3454,3894,3923,3802,3570,3952,3814,3517,3007,3059,2015,2044,2031,2039,3543,3707,4004,3759,3975,3897,3061,2943,3572,3918,3817,3898,3804,3518,4034,4008,3547,3925,3939,3709,3979,3559,3767,3818,3900,3825,3926,3929,3576,3871,3327,4036,3981,3791,3549,3987,3054,3062,3710,3820,4016,3941,3563,3771,3826,3930,3550,4040,3065,3066,3455,3982,3887,4048,3942,3989,3799,3565,3945,3773,4003,3828,3932,3571,3803,3895,3994,3946,3990,3574,4005,3815,3832,3953,3566,3774,3993,3573,3948,3919,2043,2045,2046,2047,3039,3068,4064,3519,3805,3899,4006,3954,4009,4035,3819,3577,3927,3996,3806,3901,3055,3063,4037,4010,3956,3578,3821,4017,4038,3827,3931,4012,3902,3983,3943,3711,3960,3551,3067,3069,4018,3822,4041,3580,3933,3829,4042,3991,3947,3934,3830,4020,4049,3995,4044,3833,3949,4024,3567,3775,4007,4050,3955,3834,3575,3997,3950,3807,4065,3957,4011,4066,4052,3998,3836,4013,4039,3958,3903,4019,3070,3071,3579,3961,4056,3823,4014,4068,4043,3962,3581,4021,4045,4072,3964,4022,3935,3831,4080,3582,4051,4025,3835,4046,4026,3951,4053,4054,3999,4067,3837,4028,3959,4057,4069,4058,4015,3963,4070,3838,3583,4060,4073,4023,4074,3965,4047,3966,4081,4027,4076,4082,4029,4055,4030,4059,4084,4071,4088,3839,4061,4075,4062,4077,4031,4083,4085,3967,4078,4086,4089,4090,4063,4092,4079,4087,4091,4093,4094,4095]

**Sequence group 1: ZI_4096**

[0,1,2,7,3,8,11,24,4,10,13,28,16,33,35,78,5,12,14,32,19,38,47,82,22,46,42,91,59,99,107,182,6,17,21,40,23,45,51,93,29,57,61,100,73,118,123,197,34,63,76,121,81,132,147,214,90,149,159,244,164,256,290,401,9,18,26,56 ,30,60,72,113,36,77,64,126,85,137,153,221,44,75,89,148,95,156,163,252,103,166,184,280,196,298,314,457,53,92,101,162,119,176,191,295,130,192,213,306,223,327,346,496,151,219,247,335,254,347,369,533,287,375,396,553,417,576,620,852,15,25,31,74,39,80,83,152,48,88,96,161,106,171,179,294,58,97,112,177,122,190,206,310,136,207,220,322,249,341,365,521,66,116,131,195,140,212,228,336,160,245,255,349,286,374,387,552,178,267,296,379,307,407,419,574,332,438,476,609,504,640,705,853,70,133,155,231,170,253,283,377,183,288,300,400,315,418,456,593,202,311,323,432,348,472,498,648,359,510,536,676,564,718,738,977,225,337,352,479,380,520,539,698,416,549,575,730,614,741,809,1045,455,584,621,780,638,847,869,1105,703,900,925,1082,959,1142,1249,1520,20,37,41,94,49,98,114,189,50,115,127,198,144,222,234,363,65,128,145,237,157,248,265,364,165,264,291,391,312,415,422,573,68,154 ,167,239,186,272,297,414,194,304,316,426,326,466,489,636,193,324,339,465,358,499,523,677,382,541,565,717,583,737,789,1027,79,181,187,302,201,320,338,458,215,343,351,497,370,532,548,709,289,366,381,535,402,558,582,732,444,589,626,774,659,846,871,1078,319,398,427,572,464,608,630,830,494,643,669,851,706,909,939,1127,537,704,719,926,733,960,913,1169,794,1024,1046,1259,1059,1313,1390,1556,84,199,203,357,273,373,386,540,303,390,403,567,439,591,623,832,317,433,463,592,478,631,661,855,511,671,695,905,731,937,976,1173,362,467,488,660,522,690,725,914,566,726,739,970,795,955,1031,1265,599,770,836,1025,856,1058,1080,1298,910,1093,1092,1378,1170,1423,1455,1723,397,505,544,727,590,740,788,993,627,831,848,1047,891,1061,1083,1311,662,865,915,1079,940,1104,1171,1424,992,1183,1246,1458,1284,1538,1554,1809,716,927,968,1172,1030,1178,1270,1465,1044,1267,1306,1548,1368,1583,1672,1932,1062,1314,1420,1623,1446,1675,1645,1938,1510,1753,1773,2076,1815,2134,2221,2420,27,43,52,102,62,129,146,229,67,150,158,236,169,258,266,404,69,168,180,257,188,321,333,454,216,334,356,495,372,524,545,729,71,185,200,325,218,353,367,518,230,376,388,550,406,577,597,742,246,399,421,588,459,622,641,806,473,637,672,864,675,904,936,1251,117,217,224,371,238,389,405,569,281,423,445,617,475,647,670,834,301,451,481,639,517,674,683,888,534,684,694,938,7

69,961,1012,1266,318,516,526,693,557,724,728,952,
579,768,
791,987,850,1028,1048,1307,616,808,857,1049,911,1
067,1129,1369,967,1136,1192,1425,1247,1463,1540,
1807,12
0,235,259,420,299,450,477,658,313,490,519,685,538,
702,707,941,342,527,556,708,578,765,781,984,615,8
04,849,1
033,889,1063,1116,1308,368,568,596,790,642,837,83
5,1064,663,868,901,1106,953,1132,1166,1433,699,91
2,963,1
143,985,1221,1248,1482,1015,1264,1292,1549,1377,
1585,1673,1933,383,619,646,870,682,908,954,1137,7
51,966,1
004,1236,1009,1250,1282,1531,771,1005,1014,1269,
1065,1287,1349,1582,1124,1376,1403,1624,1454,172
6,1756,1
949,805,1081,1110,1309,1167,1379,1422,1649,1193,
1448,1483,1752,1541,1774,1813,2089,1294,1491,155
0,1779,1
615,1817,1842,2209,1650,1901,1937,2272,2062,2326
,2393,2647,141,282,305,491,340,525,551,736,350,55
9,585,76
7,618,793,854,1117,378,598,649,833,673,907,890,11
26,691,924,958,1182,994,1230,1253,1511,462,668,69
2,906,75
0,943,969,1237,766,995,1011,1258,1029,1283,1297,1
558,772,1026,1060,1296,1119,1348,1391,1625,1152,
1445,14
49,1727,1490,1757,1804,2070,474,743,764,986,773,1
008,1032,1286,807,1066,1107,1312,1133,1388,1447,
1721,96
2,1118,1168,1402,1194,1459,1494,1754,1285,1495,1
551,1780,1622,1816,1841,2208,1010,1220,1268,1462
,1295,15
47,1578,1806,1357,1584,1641,1840,1720,1930,1948,
2279,1421,1651,1733,1936,1772,1959,2067,2332,180
8,2077,2
125,2389,2140,2453,2457,2767,480,775,792,1111,94
2,1128,1153,1444,971,1179,1231,1464,1271,1530,15
57,1805, 10 13, 1252, 1293,
1539,1310,1579,1644,1819,1389,1674,1640,1871,175
5, 1939,2043,2308,1125,1299,1315,1614,143
2,1648,1732,1934,1457,1734,1759,2036,1781,2063,2
116,2388,1546,1775,1812,2071,1843,2135,2141,2441
,1931,22
45,2278,2479,2327,2554,2584,2754,1195,1356,1456,
1735,1521,1758,1778,2066,1555,1814,1818,2124,190
0,2138,2
273,2456,1559,1870,1935,2244,2042,2280,2281,2555
,2088,2333,2347,2585,2421,2682,2706,3024,1722,19
58,2037,
2309,2117,2346,2392,2591,2139,2440,2452,2683,251
8,2707,2888,3108,2220,2478,2519,2755,2590,2766,2
889,310
9,2646,2900,2901,3162,3025,3163,3336,3337,54,55,8
6,125,87,134,139,284,104,138,143,308,226,331,345,5
46,105,
142,204,330,233,360,413,570,274,412,408,595,449,6
29,657,894,124,227,251,384,275,411,435,611,309,44
7,453,64
4,507,688,701,947,344,461,542,697,555,734,777,988,
594,779,829,1056,858,1096,1148,1387,135,232,292,4
46,328,
452,506,679,354,543,482,710,581,745,811,1003,410,
509,587,778,613,822,845,1076,651,860,902,1130,946
,1164,11
90,1489,437,610,645,844,689,872,933,1151,722,934,
979,1184,1007,1225,1280,1576,783,1001,1073,1229,
1094,128
1,1339,1629,1139,1345,1382,1661,1401,1700,1776,2
108,205,285,329,508,361,554,571,810,424,586,624,8
39,656,8
67,875,1150,448,625,678,873,700,932,964,1186,744,
965,1002,1210,1075,1255,1335,1611,484,686,723,94
5,746,97
8,1018,1238,838,1057,1095,1289,1138,1344,1359,16
60,874,1103,1154,1351,1185,1397,1427,1698,1226,1
452,1532 ,1737,1586,1810,1913,2109,492,735,821,10
35,866,1077,1135,1347,895,1140,1174,1386,1191,14
26,1488,1725,956,
1187,1211,1450,1288,1522,1580,1852,1319,1588,163
6,1868,1678,1928,2000,2305,1017,1239,1304,1535,1
352,161
0,1639,1890,1400,1657,1699,1978,1738,2003,2079,2
367,1481,1706,1777,2048,1790,2095,2119,2443,1903
,2132,22
11,2436,2271,2480,2587,2858,250,355,385,612,425,6
28,680,931,434,681,711,948,748,1006,1036,1333,483
,720,74
9,1039,823,1074,1101,1334,859,1100,1149,1381,118
8,1399,1430,1697,486,820,861,1051,928,1108,1155,1
398,944,
1180,1204,1434,1224,1508,1543,1788,935,1222,1245
,1507,1318,1581,1613,1869,1354,1643,1679,1927,17
05,1983,
2051,2345,547,893,929,1176,951,1208,1244,1492,98
9,1257,1291,1577,1340,1628,1656,1925,1141,1336,1
353,1631 ,1392,1676,1704,1980,1460,1709,1784,204
6,1855,2094,2127,2424,1207,1384,1435,1696,1506,1
736,1786,2084,155
2,1845,1861,2107,1914,2185,2223,2463,1637,1912,1
929,2216,1981,2274,2201,2511,2068,2342,2372,2643
,2391,27
05,2746,2902,580,949,957,1317,1109,1343,1358,164
2,1177,1380,1393,1689,1453,1711,1783,2086,1205,1
451,1505 ,1724,1534,1787,1857,2111,1589,1863,188
9,2137,1979,2219,2304,2521,1332,1509,1542,1856,1
612,1880,1951,220
2,1688,1956,2001,2298,2069,2269,2359,2645,1731,2
040,2092,2343,2112,2390,2426,2688,2186,2439,2438
,2722,25
16,2753,2773,3027,1383,1587,1646,1957,1710,2002,
2050,2313,1785,2085,2104,2373,2131,2395,2437,269
5,1858,2
115.2203.2425.2240.2442.2517.2760.2312.2545.2566

.2776.2668.2886.2898.3161.1926.2217.2296.2520.2358.2522,2664,2781,2366,2653,2690,2894,2718,2917,3006,3234,2404,2708,2750,2963,2768,3013,2997,3264,2856,3083,3117,3338,3179,3378,3415,3540,293,409,436,650,460,721,776,1019,485,782,828,1038,863,1098,1102,1394,487,862,892,1097,930,1209,1227,1480,990,1228,1316,1553,1342,1620,1647,1977,493,903,950,1223,1000,1305,1337,1608,1034,1346,1370,1658,1396,1701,1729,2020,1072,1385,1429,1708,1493,1782,1811,2074,1523,1789,1864,2114,1867,2136,2218,2589,687,991,1016,1341,1050,1371,1395,1691,1131,1431,1461,1761,1529,1847,1862,2090,1175,1467,1537,1791,1591,1866,1873,2128,1630,1874,1888,2222,2039,2275,2334,2652,1206,1590,1626,1883,1663,1950,1976,2246,1703,2038,2061,2311,2106,2356,2374,2691,1760,2078,2113,2375,2187,2423,2469,2719,2283,2476,2546,2761,2567,2779,2890,3147,696,1037,1099,1428,1165,1466,1533,1854,1189,1544,1609,1875,1638,1902,1915,2241,1256,1627,1662,1924,1702,2025,2049,2306,1739,2072,2105,2365,2129,2405,2454,2692,1338,1690,1728,2060,1844,2093,2091,2406,1859,2118,2133,2444,2247,2470,2508,2763,1891,2200,2277,2481,2307,2561,2586,2782,2341,2644,2680,2895,2721,2919,3007,3235,1355,1763,1846,2126,1872,2184,2268,2477,2023,2282,2324,2564,2329,2588,2666,2885,2041,2325,2340,2655,2407,2671,2711,2916,2460,2720,2749,2972,2772,3040,3090,3267,2073,2427,2446,2693,2509,2723,2752,2999,2547,2770,2783,3082,2891,3118,3177,3361,2684,2829,2896,3121,2961,3193,3206,3413,3004,3211,3255,3438,3314,3482,3511,3699,747,1134,1181,1545,1254,1621,1659,1982,1290,1677,1707,2027,1762,2065,2110,2455,1350,1730,1853,2087,1865,2143,2130,2462,1881,2210,2270,2544,2314,2562,2641,2857,1504,1860,1882,2142,2022,2243,2297,2565,2026,2315,2331,2642,2357,2667,2687,2904,2044,2344,2394,2686,2459,2710,2747,2973,2482,2765,2771,3041,2828,3091,3144,3322,1528,2021,2024,2310,2045,2328,2364,2670,2075,2422,2445,2704,2471,2744,2769,3015,2276,2458,2510,2748,2552,2777,2830,3088,2669,2831,2897,3122,2962,3192,3205,3412,2330,2560,2654,2778,2685,2893,2906,3146,2717,2918,2975,3204,3014,3232,3266,3461,2751,3005,3043,3254,3116,3285,3321,3492,3160,3339,3377,3509,3386,3573,3575,3787,1536,2047,2064,2447,2242,2468,2483,2764,2299,2523,2563,2780,2665,2884,2903,3145,2335,2640,2681,2887,2694,2907,2996,3195,2745,3012,2974,3209,3089,3265,3313,3480,2461,2689,2709,2960,2762,2998,3042,3252,2775,3080,3111,3286,3123,3315,3362,3508,2892,3119,3176,3323,3207,3379,3387,3543,3233,3437,3460,3621,3483,3636,3638,3784,2553,2716,2774,3081,2859,3110,3120,3320,2899,3178,3194,3376,3210,3384,3439,3574,2905,3208,3253,3436,3312,3462,3463,3637,3360,3493,3495,3639,3541,3720,3722,3852,3026,3284,3287,3481,3363,3494,3510,3697,3385,3542,3572,3721,3622,3723,3816,3854,3414,3620,3623,3785,3696,3786,3817,3855,3698,3818,3819,3936,3853,3937,3938,3939,108,109,110,175,111,208,211,276,172,210,241,392,260,429,431,666,173,240,242,428,263,442,503,714,270,502,470,759,563,787,803,1070,174,261,269,468,271,501,515,761,393,561,601,796,653,818,827,1121,430,603,664,825,713,880,919,1162,758,921,983,1260,1020,1300,1366,1653,209,262,278,560,394,600,652,813,440,665,604,842,753,885,973,1201,500,655,757,920,763,980,999,1276,799,1022,1084,1328,1120,1406,1438,1769,529,760,797,998,819,1052,1091,1375,878,1112,1161,1414,1203,1475,1514,1848,923,1199,1263,1487,1278,1515,1573,1909,1363,1595,1632,1953,1685,1984,2032,2384,243,277,395,654,443,712,715,972,512,756,784,997,802,1043,1055,1374,562,785,812,1053,826,1090,1158,1418,884,1159,1200,1470,1273,1501,1569,1897,606,816,879,1115,896,1160,1216,1496,996,1261,1279,1517,1362,1594,1607,1952 ,1054,1323,1404,1599,1415,1667,1687,1974,1484,1742,1820,2013,1876,2096,2193,2385,634,881,975,1219,1042,1277,1331,1597,1071,1364,1408,1652,1439,1686,1768,2005,1146,1419,1471,1716,1516,1800,1850,2120,1563,1886,1916,2160,1964,2206,2238,2557,1213,1497,1524,1823,1600,1896,1919,2182,1684,1945,1975,2230,2018,2249,2337,2625,1767,1992,2033,2292,2082,2379,2413,2713,2191,2448,2489,2674,2535,2786,2865,3104,268,441,469,762,513,786,814,1089,514,815,843,1122,916,1202,1234,1567,605,876,917,1241,981,1272,1321,1568,1021,1320,1367,1619,1436,1683,1694,1973,632,974,1023,1243,1086,13

24,1405,1682,1114,1412,1440,1714,1474,1798,1833,
2080,111
3,1472,1499,1797,1562,1851,1899,2161,1602,1921,1
965,2205,1991,2237,2301,2611,667,1069,1087,1410,
1145,146
8,1498,1770,1163,1503,1519,1849,1574,1908,1944,2
197,1365,1570,1601,1911,1654,1962,1990,2232,1744
,1997,20
54,2286,2147,2378,2415,2662,1443,1634,1715,1972,
1796,2012,2058,2354,1838,2099,2153,2383,2194,247
3,2503,2
735,1917,2192,2207,2490,2233,2536,2485,2801,2318
,2608,2626,2875,2635,2941,3010,3152,752,1123,114
7,1561,1
325,1593,1606,1920,1411,1618,1655,1967,1743,1999
,2035,2360,1441,1717,1795,2004,1822,2059,2149,23
87,1887,
2155,2179,2465,2231,2501,2556,2805,1566,1799,183
2,2148,1898,2174,2225,2486,1966,2226,2239,2550,2
319,253
1,2615,2877,2011,2266,2368,2609,2396,2634,2672,2
930,2474,2677,2676,2990,2802,3035,3063,3279,1633
,1877,19
40,2227,1998,2248,2300,2577,2055,2355,2380,2627,
2431,2637,2675,2939,2150,2409,2487,2663,2504,271
2,2803,3
036,2576,2815,2862,3066,2912,3130,3150,3349,2204
,2491,2548,2804,2614,2810,2882,3073,2624,2879,29
34,3140,
2984,3167,3240,3432,2638,2942,3032,3191,3054,324
3,3221,3442,3102,3301,3317,3520,3355,3566,3597,3
692,279,
471,528,798,602,877,918,1217,607,922,982,1240,104
1,1302,1322,1664,633,1040,1068,1301,1088,1469,14
85,1766,
1196,1486,1560,1839,1592,1904,1941,2229,635,1085
,1144,1473,1198,1525,1571,1894,1218,1596,1616,19
46,1666,
1985,2009,2250,1262,1635,1693,1996,1771,2034,209
7,2322,1801,2081,2156,2408,2159,2464,2500,2867,8
17,1197,
1212,1575,1242,1617,1665,1969,1329,1695,1745,202
9,1803,2103,2154,2362,1409,1751,1825,2083,1893,2
158,216
7,2428,1910,2168,2178,2502,2265,2537,2600,2878,1
442,1892,1906,2177,1961,2224,2228,2528,1987,2264
,2303,25
71,2382,2612,2628,2935,2028,2336,2397,2629,2475,
2651,2737,2985,2543,2756,2824,3037,2863,3071,313
2,3347,8
24,1235,1303,1692,1407,1750,1821,2146,1437,1834,
1895,2169,1918,2190,2195,2505,1502,1907,1960,219
6,1986,2
261,2293,2568,2019,2320,2381,2617,2429,2639,2728
,2936,1572,1968,2008,2302,2098,2369,2363,2648,21
51,2412,
2449,2714,2529,2740,2798,3049,2183,2484,2539,278
7,2569,2841,2864,3078,2603,2876,2924,3141,2989,3
169,324
1,3433,1603,2031,2102,2414,2166,2472,2530,2757,2
259,2542,2592,2852,2597,2866,2910,3115,2267,2593
,2602,28
81,2649,2915,2969,3166,2732,2988,3031,3196,3062,
3282,3304,3445,2321,2673,2726,2937,2799,2991,303
4,3225,2
825,3056,3079,3300,3133,3318,3353,3529,2926,3087
,3142,3327,3187,3357,3366,3589,3226,3417,3441,36
12,3502,
3650,3685,3791,897,1330,1413,1835,1500,1905,1947
,2236,1518,1963,1993,2263,2030,2317,2386,2729,15
98,2010,
2121,2361,2157,2467,2430,2734,2175,2488,2534,281
4,2578,2850,2869,3103,1794,2152,2176,2466,2258,2
507,254
9,2853,2262,2579,2599,2874,2613,2911,2929,3154,2
284,2610,2636,2928,2731,2968,3011,3197,2792,3053
,3057,32
83,3086,3305,3344,3514,1802,2251,2260,2570,2285,
2596,2616,2914,2323,2650,2715,2940,2741,3008,305
5,3277,2
538,2730,2800,3030,2826,3067,3094,3302,2913,3095
,3143,3328,3190,3356,3365,3588,2598,2840,2880,30
70,2927,
3139,3158,3346,2981,3168,3217,3364,3276,3430,344
4,3619,3033,3227,3293,3440,3316,3451,3507,3656,3
348,352
1,3557,3681,3576,3717,3725,3863,1824,2287,2316,2
727,2506,2736,2793,3052,2551,2811,2851,3072,2883
,3114,31
53,3345,2601,2868,2925,3131,2938,3159,3220,3359,
3009,3242,3216,3399,3303,3443,3487,3640,2733,293
1,2943,3
186,3048,3224,3292,3434,3065,3294,3307,3476,3329
,3503,3552,3680,3138,3319,3352,3515,3367,3567,35
77,3709,
3431,3605,3618,3739,3651,3762,3772,3850,2827,298
0,3064,3295,3105,3306,3326,3506,3151,3354,3358,3
556,341
6,3570,3613,3724,3155,3398,3435,3604,3486,3624,3
625,3763,3528,3657,3667,3773,3693,3806,3826,3940
,3278,34
50,3477,3641,3553,3666,3684,3779,3571,3708,3716,
3807,3750,3827,3892,3956,3596,3738,3751,3851,377
8,3862,3
893,3957,3790,3904,3905,3974,3941,3975,4016,4017
,530,531,754,841,755,882,887,1360,800,886,899,141
6,1214,1
479,1513,1942,801,898,1156,1478,1233,1564,1681,1
970,1326,1680,1668,2007,1749,2057,2145,2434,840,
1215,127
5,1604,1327,1671,1719,2015,1417,1747,1765,2100,1
879,2172,2189,2515,1512,1793,1922,2181,1955,2234
,2289,25
72,2006,2291,2353,2632,2398,2696,2788,3003,883,1
232,1372,1746,1476,1764,1878,2163,1526,1923,1826
,2198,19 89,2253,2339,2583,1670,1885,1995,2290,2017,2350,2377,2660,2123,2400,2450,2738,2514,2796,2822,3085,1741,2014,2101,2376,2173,2416,2497,2791,2214,2498,2559,2816,2595,2845,2908,3156,2295,2581,2657,2849,2678,2909,2955,3201,2759,2965,2994,3237,3029,3260,3324,3544,1157,1361,1477,1884,1565,1954,1971,2338,1712,1994,2052,2371,2144,2411,2419,2790,1748,2053,2162,2417,2188,2496,2540,2818,2252,2541,2582,2838,2659,2871,2951,3183,1828,2170,2215,2513,2254,2558,2606,2854,2370,2633,2679,2921,2758,2964,2983,3236,2418,2703,2794,2971,2817,3021,3039,3258,2846,3060,3124,3297,3170,3350,3421,3545,1836,2235,2349,2619,2410,2661,2743,2967,2435,2784,2806,3002,2823,3038,3084,3281,2532,2819,2839,3058,2920,3106,3164,3372,2947,3172,3212,3396,3246,3428,3464,3633,2605,2855,2932,3127,2976,3182,3215,3410,3028,3229,3259,3454,3298,3467,3523,3675,3077,3270,3325,3496,3342,3535,3555,3711,3419,3564,3591,3704,3611,3740,3775,3886,1274,1527,1605,2016,1713,2056,2164,2495,1718,2165,2199,2524,2256,2594,2620,2949,1827,2212,2257,2623,2351,2658,2701,2950,2399,2700,2789,2993,2820,3023,3046,3257,1830,2348,2401,2631,2492,2724,2795,3022,2512,2812,2832,3050,2844,3100,3135,3340,2499,2842,2861,3099,2946,3165,3185,3397,2978,3219,3247,3427,3269,3459,3499,3665,1943,2433,2493,2808,2527,2836,2860,3092,2573,2873,2923,3157,2956,3200,3228,3425,2785,2952,2977,3203,3016,3244,3268,3456,3068,3273,3332,3490,3375,3534,3559,3700,2835,3000,3051,3256,3098,3296,3334,3524,3148,3369,3389,3539,3422,3581,3599,3731,3213,3420,3429,3592,3457,3614,3585,3747,3512,3662,3676,3783,3683,3825,3842,3906,1988,2525,2533,2945,2725,2959,2982,3218,2809,2992,3017,3249,3061,3275,3331,3526,2833,3059,3097,3280,3126,3335,3381,3547,3173,3391,3409,3569,3455,3595,3632,3753,2948,3101,3134,3380,3184,3404,3447,3586,3248,3448,3465,3630,3513,3609,3671,3789,3291,3484,3532,3663,3548,3682,3702,3812,3582,3707,3706,3838,3748,3849,3869,3943,2995,3171,3222,3449,3274,3466,3498,3645,3333,3525,3536,3677,3563,3687,3705,3823,3382,3551,3587,3701,3600,3710,3749,3856,3644,3757,3770,3872,3800,3890,3902,3973,3426,3593,3628,3752,3670,3754,3796,3877,3674,3793,3814,3898,3834,3913,3930,3994,3688,3828,3846,3919,3864,3933,3925,4000,3884,3951,3961,4018,3979,4026,4035,4056,1373,1669,1740,2122,1792,2213,2288,2607,1829,2294,2352,2622,2403,2698,2702,3018,1831,2402,2432,2697,2494,2837,2847,3076,2574,2848,2944,3149,2958,3188,3223,3453,1837,2451,2526,2843,2580,2933,2953,3180,2618,2966,2986,3230,3020,3261,3289,3468,2656,3001,3045,3272,3093,3330,3351,3518,3107,3341,3392,3550,3395,3568,3594,3777,2171,2575,2604,2957,2630,2987,3019,3251,2739,3047,3069,3309,3113,3371,3390,3530,2807,3075,3129,3343,3175,3394,3401,3560,3202,3402,3408,3598,3479,3615,3658,3792,2834,3174,3198,3407,3239,3446,3452,3606,3263,3478,3501,3643,3538,3668,3678,3815,3308,3522,3549,3679,3583,3695,3733,3835,3627,3736,3758,3857,3771,3875,3894,3971,2180,2621,2699,3044,2797,3074,3125,3374,2821,3136,3181,3403,3214,3418,3423,3601,2872,3199,3238,3424,3262,3473,3497,3634,3299,3516,3537,3673,3561,3689,3718,3820,2954,3250,3288,3500,3368,3533,3531,3690,3383,3554,3565,3712,3607,3734,3744,3859,3411,3584,3617,3741,3635,3765,3774,3878,3661,3788,3804,3899,3837,3915,3931,3995,2979,3311,3370,3558,3400,3580,3608,3737,3471,3626,3648,3768,3653,3776,3798,3889,3485,3649,3660,3795,3691,3803,3831,3912,3728,3836,3845,3920,3868,3944,3954,4003,3517,3703,3714,3821,3745,3839,3848,3927,3759,3866,3879,3950,3895,3962,3977,4021,3808,3881,3900,3965,3917,3981,3986,4033,3928,3991,3999,4038,4010,4046,4055,4075,2255,2742,2813,3137,2870,3189,3231,3458,2922,3245,3271,3475,3310,3505,3546,3719,2970,3290,3373,3527,3393,3579,3562,3730,3405,3590,3610,3756,3646,3766,3781,3885,3096,3388,3406,3578,3470,3603,3629,3769,3474,3647,3655,3782,3669,3799,3811,3908,3488,3664,3686,3810,3727,3830,3843,3921,3742,3861,3867,3945,3880,3955,3968,4014,3112,3469,3472,3642,3489,3652,3672,3802,3519,3694,3713,3824,3735,3840,3865,3935,3616,3726,3746,3844,3760,3873,3882,3952,3801,3883,3901,3966,3918,3980,3985,4032,3654,3764,3794,3874,3809,3897,3910,3970,3833,3914,3923,3984,3934,3992,4002,4041,3847,3929,3947,3998,3

960,4005,4013,4048,3972,4019,4025,4053,4030,4061,4063,4083,3128,3491,3504,3715,3602,3732,3743,3860,3631,3755,3767,3876,3797,3888,3907,3969,3659,3780,3805,3891,3822,3911,3924,3983,3841,3932,3922,3989,3953,4001,4009,4044,3729,3813,3829,3916,3858,3926,3946,3996,3871,3948,3959,4006,3967,4011,4022,4052,3896,3963,3976,4015,3987,4027,4031,4059,3993,4037,4040,4065,4047,4068,4070,4080,3761,3832,3870,3949,3887,3958,3964,4012,3903,3978,3982,4024,3990,4028,4039,4062,3909,3988,3997,4036,4008,4042,4043,4069,4020,4049,4051,4071,4057,4076,4078,4088,3942,4004,4007,4045,4023,4050,4054,4073,4029,4058,4060,4077,4066,4079,4084,4090,4034,4064,4067,4081,4072,4082,4085,4091,4074,4086,4087,4092,4089,4093,4094,4095]

**Sequence group 1: QI_8192**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,1024,1025,67,41,144,28,69,42,516,49,74,272,160,520,288,528,192,544,70,44,131,81,50,73,15,320,133,52,23,134,384,76,1026,1028,137,82,56,27,97,39,259,84,138,145,261,29,43,98,515,88,1032,1040,140,30,2048,2049,2050,2052,146,71,262,265,161,576,45,100,640,51,148,46,1056,1027,75,266,273,517,104,162,53,193,1029,1088,152,77,1033,1030,164,768,1041,1034,268,274,518,54,83,57,521,112,135,78,289,194,85,276,522,58,168,139,99,86,60,280,89,290,529,524,196,141,2056,2064,2080,2051,101,147,176,142,530,321,31,200,90,545,292,322,532,263,149,102,105,304,296,163,92,47,267,385,546,324,208,386,1042,1152,150,153,2053,2112,2057,2054,165,106,55,328,4096,4097,4098,4100,4104,4112,4128,4099,536,577,548,113,154 ,79,269,108,578,224,1036,1057,166,519,552,195,1089,1044,270,641,523,275,580,291,2065,2058,2066,2176,59,169 ,560,114,277,156,1280,1058,87,197,116,170,61,531,525,642,2060,2081,2113,2068,281,278,526,177,2304,2082,2072,2084,293,388,1048,1060,2055,2177,2114,2560,91,584,769,198,1031,1153,172,120,201,336,62,282,1090,1536,143,103,178,294,93,644,202,592,323,392,297,770,107,180,1035,1064,151,209,284,648,94,204,298,400,608,352,325,533,155,210,305,547,300,109,1092,1154,1043,1037,184,534,537,115,4101,4160,4105,4102,4113,4106,4114,4224,167,225,326,306,772,157,656,329,1072,1038,110,117,212,171,776,330,226,549,1096,1281,538,387,308,216,1045,1156,416,271,279,158,337,550,672,118,332,579,540,389,173,121,553,199,784,179,228,338,312,704,1059,1282,390,174,554,581,393,283,2059,2088,2116,2178,122,448,353,561,4108,4129,4161,4116,4352,4130,4120,4132,203,63,340,394,527,582,556,181,1050,1537,1104,1061,1049,1046,295,285,232,124,205,182,643,562,286,585,1160,1284,299,354,2067,2061,2096,2062,211,401,1288,1062,1538,1120,185,396,2120,2305,2069,2180,344,586,1091,1065,1168,1052,645,593,1093,1066,535,240,4103,4225,4162,4608,4107,4136,4164,4226,206,95,327,564,1540,1073,800,402,356 ,307,301,417,2083,2306,2074,2561,213,568,832,588,186,646,404,227,896,594,1098,1296,1184,1544,1312,1552,4115,4109,4144,4110,4168,4353,4117,4228,418,302,649,771,1216,1568,360,539,4131,4354,4122,4609,4176,4133,4121,4118,111,331,214,309,2128,2085,2073,2070,4232,4356,4360,4134,4610,4192,5120,5121,188,449,1094,1068,1155,1105,217,408,2184,2308,2312,2086,609,596,551,650,229,159,420,310,541,773,610,657,2562,2144,3072,3073,333,119,600,339,218,368,652,230,391,313,1074,1097,450,542,1039,1344,334,233,555,774,175,123,1157,1076,658,612,341,777,2115,2089,2192,2076,220,314,424,395,673,583,1047,1158,355,287,183,234,125,557,660,616,1408,1100,342,316,241,778,1161,1106,563,345,452,397,403,207,1080,1051,674,558,785,432,2117,2090,2564,2097,2122,2320,2208,2568,357,187,1121,1063,1283,1108,236,664,624,587,780,705,126,242,565,398,1162,1169,346,456,1285,1053,358,405,2336,2576,2240,2592,303,569,244,595,189,566,676,361,1067,1122,706,589,215,786,1539,1112,2118,2092,2179,2129,1164,1054,647,348,419,406,464,680,2098,2121,2063,2368,801,362,590,409,570,788,597,572,219,311,1170,1095,1286,1289,708,598,601,651,1185,1600,1069,1124,421,792,802,611,602,410,1664,1075,231,688,1172,1070,653,248,369,190,364,654,659,335,1099,1290,2181,2100,2071,2182,480,315,221,370,1297,1541,1128,1186,613,422,425,451,4163,4137,4240,4124,4165,4138,4612,4145,614,543,235,412,343,372,1077,1217,775,317,222,426 ,453,237,559,833,1176,1101,1188,1792,129

2,1298,804,712,2432,2124,3074,3076,2185,2130,210 4,2075,2145,2087, 2307,2132,834,661,808,779,617,604,433,720,816,836 ,347,897,1542,1078,1107,1081,243,662,1545,1136,21 86,2193 ,2309,2077,454,318,675,618,4170,4368,4256 ,4616,4384,4624,4288,4640,898,781,376,428,2091,21 46,2563,2136,30 80,3088,2188,2078,665,736,567,840,4166,4140,4227, 4177,4146,4169,4111,4416,625,238,1159,1102,2194, 2119,23 10,2313,2209,2624,2093,2148,1313,1218,1109,1300, 2688,2099,2196,2094,1546,1082,359,457,399,787,59 1,678,43 4,677,1192,1163,3104,3075,2123,2314,1123,1110,34 9,245,458,666,620,363,127,191,782,407,4229,4148,4 119,4230 ,4480,4172,5122,5124,436,626,1084,1304,1 113,1314,1553,1548,571,465,1220,1165,681,246,707, 350,1125,1171,12 00,1166,2321,2565,2152,2210,2101,2241,3077,3136, 2200,2125,3081,3078,599,668,790,460,1554,1345,10 55,1224, 2212,2816,3089,3082,249,682,1114,1569,573,411,80 3,789,709,365,440,628,4233,4178,4152,4123,4193,41 35,4355, 4180,689,374,423,466,2316,2322,2566,2102,2131,21 05,2569,2160,793,250,371,481,4234,4241,4357,4125, 4139,41 94,4611,4184,1316,1346,1556,1287,1173,1126,1129, 1328,574,413,603,366,468,655,900,805,1320,1187,11 16,1071, 1291,1409,1570,1348,5128,5136,4236,4126,6144,614 5,6146,6148,615,684,710,429,1232,1410,794,252,373 ,605,84 8,690,1174,1177,713,632,482,806,427,904,2183,2126 ,2337,2242,414,223,1189,1130,2133,2324,2570,2106, 663,692 ,835,619,1079,1352,1560,1601,472,455,796, 809,2216,2187,2147,2134,1572,1137,1178,1103,714, 721,1293,1132,42 42,4167,4358,4361,4257,4672,4141,4196,837,716,86 4,810,606,912,722,696,1602,1248,1190,1543,2108,23 28,2137, 2338,377,435,817,319,621,812,484,430,838,667,1576 ,1219,1294,1665,1547,1299,2577,2572,2244,2189,48 8,239,37 8,459,622,627,1604,1315,2149,2195,2224,2190,1083, 1193,437,380,818,461,496,669,679,724,841,629,2578 ,2369,2 079,2248,1584,1138,1301,1180,1111,1221,351,467,4 736,4147,4244,4142,5152,5123,4171,4362,4369,4613 ,4200,42 58,4149,4289,5125,5184,438,737,251,462,2138,2593, 2340,2370,2580,2311,2197,2150,442,441,1140,1194, 1085,15 55,1549,1666,1305,1302,1550,1201,469,247,683,842, 1317,1412,738,899,2153,2352,2344,2211,670,783,84 9,820,21 40,2095,2315,2433,728,928,791,367,4248,4173,5129, 5126,4260,4864,5137,5130,901,630,1115,1608,685,8 44,1793, 1222,633,711,1196,1144,1225,1360,253,691,2594,23 72,2256,2434,1086,1306,1167,1127,824,902,1202,13 18,3090, 3200,2198,2201,4364,4370,4614,4150,4179,4153,461 7,4208,2213,2154,2103,2376,1117,1668,686,740,850, 375,444 ,470,483,415,1226,1616,4231,4174,4385,429 0,4181,4372,4618,4154,1347,1416,485,905,1321,179 4,795,473,1131,1 204,1175,1233,1308,1672,1118,1228,634,744,852,96 0,2584,2625,2596,2161,2202,2127,2317,2156,1322,1 424,1632 ,1376,1349,1557,1179,1234,2626,2272,308 4,3105,2214,2567,2600,2243,865,693,1329,1571,132 4,1133,1208,1558, 1561,1139,797,906,3137,3092,2318,2689,715,807,11 91,1249,2571,2323,2628,2339,1350,1330,474,636,69 4,254,71 7,575,913,798,1796,1181,1680,1353,811,379,2107,22 17,2608,2162,4264,4235,4195,4182,4156,4376,4185, 4386,69 7,431,607,489,866,723,486,908,2325,2204,3328,3106 ,2135,2245,2164,2218,1134,1141,718,813,476,856,83 9,725,1 236,1195,1800,1354,698,914,752,868,819,814,439,92 9,2109,2579,2573,2690,1250,1573,490,623,671,739,9 16,463, 843,381,497,930,1562,1411,1332,1240,2329,2326,25 74,2225,2341,2436,3096,3108,2139,2632,2817,2246, 1440,129 5,1303,1182,4625,4620,4292,4237,6152,6160,6176,6 147,4197,4243,4272,4238,4626,4417,4127,4296,4186 ,4641,43 88,4418,4628,4359,4245,4198,1361,1574,1696,1142, 1356,1603,1564,1413,1197,1145,1577,1223,821,726, 1808,120 3,1252,1362,1336,1728,961,872,1414,1198,3079,320 1,2220,2168,2249,2384,2110,2330,492,631,1578,160 5,3138,3 584,2191,2151,4201,4400,4392,4259,4188,4143,4363 ,4481,729,700,443,741,1417,1307,1146,1472,1377,15 85,1227 ,1087,845,920,382,822,4642,4420,4304,4482 ,5138,5248,4246,4249,6149,6208,6153,6150,4261,42 02,4151,4424,13 64,1418,1551,1606,1580,1205,1319,1309,1256,1148, 851,730,2226,2342,2141,2692,4632,4673,4644,4209, 4250,417 5,4365,4204,4674,4320,5132,5153,4262,4615,4648,4 291,2250,2640,2371,2440,2345,2818,2155,2228,5185 ,5140,43 66,4737,4619,4371,4676,4387,3083,3112,2199,2257, 498,880,742,445,471,635,1229,1206,1667,1586,1310, 1609,93 2,687,1323,1378,2332,2696,2142,2252,6161,6154,61 62,6272,4155,4265,4656,4210,2346,2448,2656,2400, 903,825, 500,846,745,826,1235,1425,1209,1420,732,446,962,9 36,475,853,1368,1610,867,637,907,487,1669,1617,23 73,2581 ,2203,2258,2353,2595,2348,2157,3140,3202,3091,3085,1559,1264,695,746,2232,2582,2585,2163,
1230,1119,828,7
53,1351,1588,854,857,2215,2273,2374,2354,2820,22
05,2704,2377,4373,4252,5376,5154,4183,4293,4212,
4266,415
7,4627,4621,4738,6156,6177,6209,6164,4377,4374,4
622,4273,6400,6178,6168,6180,1824,1426,1380,1331
,1325,14
41,504,799,3120,3086,2158,2165,2260,2219,2824,23
78,4389,4484,5144,5156,6151,6273,6210,6656,255,9
64,1237,
1592,2274,2597,3144,3329,1856,1612,909,719,1210,
1670,1428,1251,1920,1618,477,915,638,748,1442,13
26,1673,
1795,944,869,491,699,754,858,4187,4680,4865,4294,
5127,5249,4268,4216,4297,4432,4158,4378,5186,563
2,4239,
4199,1384,1563,478,968,383,910,815,976,2586,2435,
2356,2264,3093,3204,2464,2319,2327,2206,2385,259
8,2720,
2166,2380,2627,1135,1355,870,917,1238,1333,727,4
93,873,701,1212,1473,1241,1432,1633,1620,2588,24
37,2221,
2169,2601,2247,2832,2227,2276,2386,2360,2752,310
7,3330,2438,2222,1575,1674,1253,1183,1444,1334,9
31,756,2
602,2629,2441,2331,1565,1797,860,499,731,823,163
4,1681,1357,1143,1624,1363,2170,2496,2401,2609,1
242,1392 ,1676,1254,922,874,1415,1337,918,502,147
4,1566,4274,4390,4189,4740,4298,4688,4419,4488,9
33,743,760,881,22
51,2111,2388,2442,4393,4866,4203,4276,5131,5160,
4247,4305,1358,1257,1579,1798,1199,1147,1682,163
6,2575,2
630,2604,2229,3098,3585,3152,3109,494,702,921,50
1,1365,1801,1244,1338,4380,4744,4190,4300,4394,4
496,4704
,4448,3097,3094,2343,2333,2280,2172,2253,2230,14
48,1419,1697,1607,2691,2610,2334,2633,1379,1311,
1207,125
8,1149,1581,1684,1640,1366,1340,1265,1802,1587,1
369,1476,1421,3208,3332,2347,2402,2259,2449,3336
,3110,44
21,4629,4251,4306,4401,4643,4396,4205,876,847,99
2,447,1427,1231,733,827,1698,1582,1809,1456,934,8
82,937,9
63,1381,1211,1260,1688,3586,3168,2233,2444,2392,
2634,3139,3113,3216,3100,2693,2641,5188,5250,513
9,5133,4
280,4630,4633,4211,747,505,855,924,734,829,965,93
8,1648,1611,1804,1729,3141,3114,2583,2288,4263,4
321,442
2,4402,4868,4253,4752,4425,2254,2143,2375,2612,8
84,506,749,945,1150,1266,966,755,859,940,1589,142
2,1370,1
480,1382,1429,1327,1593,1268,1619,5168,5134,4206
,4213,4308,4267,4872,4426,3588,3121,2848,2450,24
04,2355,
2349,2465,2261,2616,2880,2636,830,911,871,639,88
8,479,1213,1590,946,750,969,508,4322,4645,5192,53
77,4634,
4483,4404,4312,5141,5252,4512,4367,4375,4254,443
3,4646,861,757,970,919,2234,2694,2452,2275,2944,2
642,314
6,3344,3232,3592,3360,3600,2466,2350,2697,2819,3
264,3616,2408,2587,875,862,758,948,1700,1385,173
0,1613,2
159,2379,2262,2357,1239,1810,1671,1372,4768,4214
,4428,4675,4636,4485,4269,4217,1443,1430,1488,17
04,1825,
1386,1614,1433,4649,4295,4880,4275,4324,4434,440
8,4800,1594,1812,1621,1596,1243,1335,977,923,173
2,1622,1
625,1675,2236,2497,3142,3116,1445,1816,1826,1635
,3203,3153,2265,2456,1626,1434,1255,1712,2657,26
44,2599,
2698,2277,2207,2468,2358,972,761,1677,1272,5155,
5378,4486,4270,4650,4677,4489,4379,2589,2821,265
8,2705,2
381,2167,2648,2387,1393,1214,1388,1678,2266,2416
,2700,2278,6155,6184,6212,6274,4218,4544,4449,46
57,4299,
4159,4436,4490,4623,4678,4652,4277,2439,2361,312
2,3145,1683,1359,1504,1339,1245,1394,877,952,495,
703,935 ,978,883,762,503,925,2498,2590,3087,3392,
2382,2281,2603,2822,878,735,1637,1446,2223,2171,
3205,3124,1449,1
475,993,885,2706,2660,2389,2825,2268,2362,2472,2
443,2721,2631,3095,3206,2403,2335,2231,2282,1638
,1567,12
59,1436,1367,1396,1799,1341,5146,5633,5200,5157,
5145,5142,4391,4381,4328,4220,4301,4278,4739,465
8,4382,4
681,2173,2605,2708,2664,3456,3148,2390,2364,2289
,2826,3209,3154,2611,2393,2500,2445,5256,5380,43
95,4450,
6163,6157,6192,6158,4307,4497,5384,5158,5634,521
6,4281,4492,1246,1450,1477,1261,2451,2255,3128,3
099,272
2,2606,2833,2480,2405,2235,3169,3111,3331,3156,2
284,2712,1583,1857,1828,1736,6216,6401,6165,6276
,4440,46
82,5187,5161,1858,1685,1832,1803,2672,2635,2828,
2753,5264,5148,4741,4689,5189,5162,4631,4336,217
4,2290,2
613,2446,939,994,1641,1628,1457,1744,980,926,184
0,1860,1371,1921,1267,1686,1478,1342,3210,3217,2
394,2504 ,3333,3101,2406,2453,1699,1642,764,941,4
302,4191,4423,4660,5636,5169,4896,4498,1922,1805
,967,886,1400,14
52,831,947,1689,1760,1591,1864,507,889,1649,1262,
4452,4403,4397,4513,6179,6402,6170,6657,4309,466
4,4928,
4684,4282,4742,4500,4323,2351,2617,2292,2643,138
3,1481,1423,1811,984,751,1615,1702,1458,1701,137
3,1269,2

237,2614,2724,2409,3115,3170,2754,2637,1482,1690
,1644,1387,1151,1215,1806,1431,1460,1650,1595,14
89,942,9
96,1705,1270,4992,4690,5194,5392,5280,5640,5408,
5648,2263,2834,3587,3160,971,890,1731,1374,1623,
1692,181
4,1484,1273,1706,509,949,1597,1435,973,1000,892,9
50,1827,1813,3212,3102,2695,2396,2467,2454,2512,
2728,45
14,4398,4745,4867,5312,5664,4456,4635,4207,4427,
4310,4405,6224,6181,6169,6166,4284,4545,5190,516
4,5251,5
201,4313,4504,2849,2410,2638,2457,2618,2836,2645
,2620,2267,2359,3218,3143,3334,3337,2756,2646,26
49,2699,
3233,3648,3117,3172,2469,2840,2850,2659,2650,245
8,3712,3123,2279,2736,1733,1389,1464,1652,3220,3
118,270
1,2296,2417,2238,2412,2702,2707,2383,3147,3338,1
713,1398,1447,1490,2528,2363,2269,2418,6280,6404
,6408,61
82,4705,4692,4647,4746,4325,4255,4516,4406,4637,
4869,4706,4753,863,759,1817,1274,3345,3589,3176,
3234,665
8,6240,7168,7169,4429,4215,4696,4435,1395,1505,1
598,1437,1008,510,1627,1390,2661,2470,2473,2499,
2662,259
1,2283,2460,2391,2420,3125,3265,2823,2365,2270,2
474,1492,1679,1924,1829,979,953,1639,1708,2501,2
285,2607 ,2881,3224,3149,3236,3840,3340,3346,285
2,2760,2882,2709,2856,2827,2665,2652,2481,2768,1
734,1453,1818,127
6,4314,4464,4748,4326,4487,4409,5170,5193,4546,4
638,5135,5440,4430,4329,4651,4870,4271,4219,5253
,5172,47
54,4708,4437,4873,6211,6185,6288,6172,4316,4410,
4520,4491,763,974,1397,1629,1872,1714,954,879,98
1,982,17
37,1656,2864,2884,2395,2945,3590,3126,3155,3129,
2291,2710,3593,3184,1506,1830,1451,1928,2502,236
6,2723,2
666,4769,4679,5143,5254,4451,4383,4279,4330,4221
,4653,4756,4712,5504,5196,4438,4412,1438,1247,16
87,1716,
927,995,1859,1643,1496,1479,1820,1833,2946,2829,
2424,2476,2713,2784,2615,2888,1738,1745,765,956,
1861,174
0,1888,1834,887,985,1630,1936,2673,2286,3207,315
0,1746,1720,1401,1459,1841,1343,997,986,3361,326
6,3157,3
348,4337,4874,5257,5202,4659,4441,4548,4493,4499
,4303,5176,5147,4770,4654,4881,4528,6213,6186,66
60,6193,
6218,6416,6304,6664,3594,3130,2407,2505,1645,183
6,1508,1454,4453,4283,5217,5159,5379,5204,4332,4
760,244
7,2835,2639,2726,1862,1691,1512,1263,2482,2725,3
240,3211,1402,1483,1646,1651,4720,4683,4876,4801
,4222,43
38,4661,4494,5258,5265,4442,4552,5381,5149,4454,
4501,3171,3158,2397,2293,2506,2714,2668,2411,217
5,2239,2
830,2455,943,891,1461,1404,6432,6672,6336,6688,4
399,4665,4340,4691,4285,4662,4772,4457,5163,5218
,4802,46
85,998,766,1842,1485,2484,2674,3132,3352,4311,48
82,5635,5208,6214,6188,6275,6225,3161,3362,3601,
3596,152
0,1693,1703,1748,2619,2513,3268,3213,2729,2294,2
755,2398,3173,3219,3248,3214,511,988,1865,1653,1
375,1491 ,1462,1761,2647,2716,2838,2508,3602,339
3,3103,3272,1275,1486,1466,1465,1001,951,1493,12
71,1707,1866,1762 ,1923,2297,2730,3162,3617,1002,
893,1694,1807,975,894,1873,1844,1752,1952,1815,1
391,5260,5150,4743,4444,4
515,4502,4560,4776,6194,6217,6159,6464,4897,4458
,4686,4505,4666,4884,4693,4668,4315,4407,5266,51
91,5382,
5385,4804,4694,4697,4747,5281,5696,2621,2459,285
1,2837,1925,1654,1709,1868,2757,2413,2488,2676,1
657,173
5,1009,955,1277,1715,1848,1926,2737,2422,2471,25
14,2841,2298,2419,2529,3364,3394,3604,3335,5165,
5220,451
7,4888,4898,4707,4698,4506,5760,5171,4327,4784,5
268,5166,4749,4344,4465,4286,4460,4750,4755,4431
,5195,53
86,6277,6196,6167,6278,4576,4411,4317,4466,3221,
3174,3177,3376,2622,2461,2651,2414,2516,2703,294
8,2853,1
710,1764,1874,1399,5393,5637,5224,5282,4709,4518
,4521,4547,3368,3235,3164,3119,1468,1494,1004,10
10,1507,
1439,1509,1929,3339,3457,3618,3396,2663,2732,275
8,2477,3280,3458,2842,2300,4710,4639,4331,4508,4
439,446
8,5173,5313,2421,2653,2896,2738,3222,3225,2761,2
680,1819,1497,1658,1768,2530,2854,2475,2952,1876
,1984,95
7,983,2462,2271,3237,3178,1889,1717,1821,1930,17
39,1831,1498,1660,4871,4413,4318,4522,4549,4333,
4655,492
9,2711,2740,2883,2667,3127,3400,3608,3649,2520,2
503,2844,2857,3620,3185,3226,3151,5272,5197,5284
,5888,53
88,5394,4900,4808,6528,6220,7170,7172,6281,6226,
6200,6171,958,987,1718,1278,1741,1599,1012,999,2
762,2769 ,3341,3180,2885,2764,2912,2858,6241,618
3,6403,6228,4930,4757,4904,4875,4713,4700,4529,4
816,4912,4932,444
3,4993,2654,2960,2770,2744,3650,3296,3238,3591,5
638,5174,5203,5177,4339,4758,5641,5232,2425,2483
,2865,23
67,2669,2860,2532,2478,2886,2715,3624,3267,3342,
3713,3595,3347,2536,2287,2426,2507,2670,2675,365
2,3363,3

131,3241,2485,2428,2866,2509,2544,2717,6282,6289
,6405,6173,4550,4414,4771,4714,4994,4877,4472,45
24,6187,
6242,6659,6232,1937,1822,1835,1403,1721,1455,101
6,767,2727,2772,2889,2677,1631,1513,1890,1747,36
32,3186,
3349,3228,3159,3269,2399,2515,1510,1932,1742,183
7,1500,1880,1863,1749,2486,2785,2299,2510,2490,2
489,318
8,3242,7176,7184,6284,6174,4761,4832,4663,4936,4
721,4334,5255,5198,6290,6215,6406,6409,6305,6720
,6189,62
44,5409,5314,5205,5396,1722,1938,989,1003,1776,1
892,1843,1838,1463,1953,1514,1647,1695,1763,1940
,1487,31
33,3603,3597,3714,3353,3350,3598,3249,6784,6195,
6292,6190,5642,5178,4455,4553,4495,4883,4687,477
4,4530,4
773,5288,5259,1867,1405,990,1005,1521,1954,1845,
1750,2517,2295,2731,2890,1985,1896,1516,1655,175
3,1724,1
467,1765,3365,3460,2786,2947,2718,2831,2897,2868
,2776,2976,2839,2415,2949,2678,3163,3656,2733,28
92,3841,
3270,7200,7171,6219,6410,5219,5206,4445,4341,455
4,4762,4716,4459,4223,4287,4878,4503,4532,4722,5
180,540
0,5209,5410,5649,5644,1869,1944,1406,1846,1875,1
754,1522,1904,1766,1469,959,1011,2681,2759,3244,
3192,149
5,1659,1956,1711,1927,1849,1013,895,1524,1870,17
69,1850,1756,1470,1986,1960,4667,4561,5316,5261,
4777,434
2,4803,4446,5221,5267,5296,5262,6417,6661,6248,6
306,6197,6337,7173,7232,6296,6221,7177,7174,4695
,4764,48
86,4556,5650,5441,5151,5320,6308,6912,7185,7178,
4345,4778,5210,5665,1499,1877,1891,1661,1931,151
1,1719,1
770,3273,3408,2301,2739,3134,3354,3215,3175,4669
,4507,4899,4885,4805,4461,4536,4724,2872,2950,32
50,3366,
3165,3716,2734,2788,2898,2423,2492,2518,2531,246
3,3274,3664,3395,3464,2533,2953,3369,3842,2843,2
521,317
9,3252,3223,3281,3356,3720,3166,3276,2682,2792,2
900,3008,1852,1777,1878,1881,3370,3472,3680,3424
,3397,36
05,3227,3282,4785,4470,4519,4562,6412,6418,6662,
6198,2913,2741,3377,3619,3372,3181,3256,3606,622
7,6201,6
665,6256,4889,4346,4467,4577,3609,3187,2845,2954
,2763,2855,3239,3297,5412,5442,5652,5383,5269,52
22,5225,
5424,4670,4509,4699,4462,4564,4751,4996,4901,152
8,1823,1279,1988,3398,3378,2522,2684,5416,5283,5
212,516
7,5387,5505,5666,5444,4711,4780,4806,4525,5328,5
506,4890,4348,2742,2302,2765,2623,2961,2846,3844
,3229,44
69,4701,4944,4786,5270,5273,4809,4728,4578,4902,
4523,5000,6279,6222,6433,6338,3728,3401,2859,242
7,2745,2
479,2655,2537,2914,2771,2534,2956,1933,1743,1501
,1939,1006,1014,1662,1772,1968,1893,1515,1723,17
78,1882,
1502,1992,1017,1018,1407,1934,4510,4319,5285,522
6,6229,6420,6666,6202,4759,4788,4931,4715,5175,5
448,565
6,5697,1839,2000,1894,1941,3182,3189,2766,2861,4
568,4551,4892,4905,6312,6283,6243,6230,2524,2904
,2887,27
73,1751,1517,1897,1725,5668,5233,5274,5199,4810,
4817,5389,5228,4933,4812,4960,4906,4702,5008,481
8,4792,5
698,5344,5286,5639,6204,6424,6233,6434,4473,4531
,4913,4415,4717,4908,4580,4526,3284,3243,3848,34
02,2746,
2962,2800,2916,2867,2862,2487,2977,3298,3621,253
8,2671,4934,4763,5672,5315,5390,5761,5643,5395,6
673,666
8,6340,6285,4584,4335,4474,4555,4718,4723,5700,5
411,6245,6291,6320,6286,5179,5289,4533,4476,4914
,4557,45
92,4765,2719,2787,2964,2511,2891,2429,2545,2978,
4775,4820,4937,4725,6674,6465,6175,6344,5680,523
4,5397,5
276,5207,5317,4447,4563,4534,4833,4347,4558,6234
,6689,6436,6466,6676,6407,6293,6246,4538,4537,52
36,5290,
3610,3459,3380,3288,3488,3343,3351,3230,3409,362
2,3744,3190,3404,3651,3612,3461,5181,5651,5645,5
762,540
1,5398,5646,5297,4565,4343,4779,4938,5413,5508,4
834,4995,1955,1780,1884,1523,3245,3193,3625,3271
,2869,27
74,3856,3251,1755,1847,1946,1898,3300,3410,3384,
3776,3009,2920,3462,3246,2540,2679,3626,3653,277
7,2748,2
491,2789,6249,6448,6440,6307,4766,4879,4945,4916
,6236,6191,6411,6529,4824,5024,4887,4463,3465,33
55,3194,
3520,1942,1526,1957,1767,3425,3633,3275,3135,178
4,1905,1518,1726,2893,2968,2430,2870,1945,1525,1
900,187
1,3412,3466,3599,3654,3628,3253,3367,3357,991,10
20,2016,1471,3304,3196,2899,2778,4997,4726,5211,
5704,478
1,4940,5889,5318,2546,2928,2790,2493,2519,2683,3
277,3254,1757,1851,1958,1906,3715,3634,3358,3657
,2980,27
35,3371,3426,2951,2873,2548,2894,4729,4807,5292,
5240,5321,5456,4349,4787,6690,6468,6352,6530,518
2,5402,5
263,5223,2793,2874,3283,3473,3257,3468,2780,2494
,3010,2984,2523,2901,3416,3658,2915,2685,2955,25

35,3717,
3665,3607,3312,2743,2794,1961,1987,1771,1529,327
8,3167,2876,2801,4920,4998,5298,5414,7186,7296,6
294,629
7,1879,1948,1758,1853,3399,3636,2902,2905,3872,3
474,3428,3379,3373,3489,2552,2847,2303,3012,3285
,3640,10
07,1015,1989,1962,3904,3660,2957,2767,1908,1530,
1773,1969,1990,1779,1883,1964,3258,3718,3476,329
9,6309,6
250,6199,6472,5213,5764,4782,4836,4946,4471,4540
,4566,4579,4511,5322,5712,5443,5512,4581,5001,54
17,5890,
4891,4569,5227,5300,5271,5329,5404,5768,5214,532
4,4730,4840,4948,5056,6680,6721,6692,6257,6298,6
223,641
3,6252,5418,5520,5728,5472,5445,5653,5275,5330,6
722,6368,7180,7201,6310,6663,6696,6339,4961,4789
,5425,56
67,5420,5229,5304,5654,5657,5235,4893,5002,7233,
7188,6414,6785,4811,4903,5287,5345,3968,3666,252
5,2963,2
686,2796,3490,3374,6667,6419,6724,6435,5446,5426
,4570,4732,4790,4350,4813,4671,5009,4894,5892,52
77,5776,
5449,4907,4475,6203,6313,6704,6258,3721,3843,299
2,2917,2539,2747,2802,2906,4793,4527,4703,4585,4
962,481
9,4582,5004,1854,1935,1895,1663,3432,3611,2526,3
016,6421,6300,7424,7202,6231,6341,6260,6314,2431
,2958,28
63,3024,3183,3403,2918,2965,1912,1503,1019,1021,
3286,3381,2775,2541,5230,5237,4814,4909,4572,495
2,4935,4
821,5332,5291,5896,5450,4794,5010,4848,4964,4915
,4910,4535,5025,6205,6675,6669,6786,5346,5669,45
86,4719,
4767,4835,5012,4559,2921,2749,3260,3521,3289,348
0,3681,3668,1970,1774,1993,1532,3623,3722,3301,3
231,493
9,4477,4593,5026,5658,5507,5428,5336,6425,6422,6
670,6321,6437,6532,7192,7204,6235,6728,6913,6342
,5536,53
91,5399,5278,5457,5670,5792,5238,5452,5699,5660,
5509,5293,5241,5673,5319,4917,4822,5904,5299,349
2,3382,2
979,2804,3613,3845,2908,2547,1885,1781,1994,1943
,2779,2871,3682,3729,3405,3191,3672,3411,1899,18
86,1782,
1972,2001,1947,1996,1785,3290,3440,3724,3302,534
8,5458,5432,5824,5057,4968,5510,5294,7175,7297,6
316,626
4,6345,6480,6206,6426,4588,4727,5674,5701,7234,7
680,6287,6247,2970,2922,3463,3385,2966,2550,3522
,3614,48
25,4796,4539,4837,5513,5403,5242,5568,2981,2791,
2808,2929,3406,3305,3627,3846,1901,1976,1519,172
7,3247,3
195,3730,3684,2542,2750,2969,2549,3413,3849,3292
,3386,5473,5681,5323,5183,4941,5016,4478,4918,54
60,5514,
5647,5702,5676,5301,5415,5405,3496,3467,3745,365
5,1959,2002,1907,1786,3427,3359,3255,3306,3197,3
629,373
2,3688,1527,1949,1902,1759,3414,3388,3313,3850,5
352,5244,4947,4826,6322,6438,6237,6788,3635,3417
,3524,34
69,2924,2895,3040,2495,3475,3279,2781,2875,2017,
1909,1963,2018,6346,6736,6467,6536,6441,6914,625
1,6324,7
179,7208,6295,6353,4594,4976,4838,4541,3746,3630
,3857,3504,2982,2930,2985,3011,4567,4731,5325,53
02,5763,
5682,5406,5705,3429,3259,3308,3736,2795,2553,290
3,2972,5028,4783,5419,5474,6428,6792,6238,6348,2
782,287
7,3013,2986,3696,3659,3852,3777,6442,6544,6752,6
496,4999,4921,4596,4942,4841,4922,5331,5521,5305
,5516,48
28,4542,5058,5032,4571,4949,5464,5706,4963,4733,
2004,1950,1788,1965,2932,2554,2797,2993,1991,191
0,1855,1
971,3198,3314,3014,2803,5003,4583,5765,5713,6469
,6677,6299,6354,6449,6691,6444,6253,7236,7298,71
87,7181,
2907,2988,3637,3470,3418,3528,3430,3477,5655,536
0,4791,4842,6328,6678,6681,6259,5326,5215,4924,4
849,544
7,5684,4950,4953,6311,6369,6470,6450,6916,6301,6
800,6473,1022,1023,1531,1913,3375,3641,3316,3667
,2878,29
59,2919,2687,2936,2527,3261,3638,5920,5522,5476,
5427,5421,5537,4600,4895,7216,7182,6254,6261,635
6,6315,6
920,6474,2994,2798,3017,2556,2909,2805,3018,2967
,2008,1775,1966,2020,2923,2910,2806,2996,3748,34
33,3778,
3661,3287,3858,3719,3420,4351,5060,5333,5688,637
0,6693,7240,7425,1995,1914,1533,1973,3491,3478,3
536,375
2,1997,2024,1916,1974,3873,3434,3662,3481,3642,3
860,3669,3644,3291,3383,3025,2971,5952,5708,5005
,4815,53
06,5766,5524,5347,3780,3670,3673,3723,3493,3864,
3874,3683,6016,5714,4573,5011,4734,4844,5538,542
2,3674,3
482,3303,3760,1887,1783,2032,1534,3020,2809,3725
,3320,3441,3262,3436,3726,5769,5891,5040,4965,45
87,4795,
4850,4954,5480,5659,4574,5064,4479,5006,4911,507
2,6682,6531,6452,6360,7189,7300,6560,6415,6423,6
302,648
1,6694,6816,6262,6476,6723,5231,5451,4966,5013,5
334,5429,4823,4589,4969,4797,5308,5569,5337,5528
,5729,57
16,3731,3407,3552,3387,3293,3442,2925,3000,6684,6533,6317,6265,6697,6343,6928,6323,2543,2751,298
3,3026,2
003,1977,1787,1998,2931,2810,2551,2973,2926,2783
,3685,3494,6372,6482,6456,6848,7203,7426,6534,63
18,5671,
5770,5349,5279,5540,5430,5027,4852,6698,6725,653
7,6427,5661,5893,4956,4595,4827,4919,5730,5777,5
453,523
9,5720,5459,6266,6592,6497,6705,5338,5488,5772,5
350,3497,3523,3041,2933,3686,3615,3307,3484,5018
,4970,55
11,5433,5014,4598,5570,5662,3415,3444,3847,3389,
1978,1903,2005,2006,5029,4839,4856,4977,6347,620
7,6484,6
538,3294,3498,3525,3309,3631,3905,3876,3784,3906
,3733,3880,3851,2987,3042,3689,3676,5454,5353,56
75,5894,
5295,5243,5778,5732,6671,6726,6700,6325,7194,768
1,7248,7205,4590,4798,5017,4597,5461,5897,5340,5
434,719
3,7190,6439,6429,6376,6268,6349,6326,1951,2019,1
789,1980,3505,3792,3028,2974,3888,3908,3419,3969
,1911,20
09,2021,2010,5544,5515,5793,5703,6787,6706,6430,
6729,5475,5407,5303,5354,5245,5677,5780,5736,546
2,5436,5
361,5898,5683,5465,5572,5517,7304,7428,6443,6498
,6355,6545,7432,7206,4972,4943,5088,4543,5523,53
27,4829,
4923,5794,5678,5905,5552,5030,4978,5033,5059,547
7,5307,5356,5784,7682,7264,6329,6540,6488,6730,7
235,720
9,7312,7196,6789,6737,4843,4601,4951,5020,4830,4
925,5061,5034,5744,5707,5900,5825,7237,7210,6679
,6384,63
50,6239,6471,6708,4980,4602,4845,5041,5246,5362,
5062,4851,4955,5036,5685,5518,3315,3734,3526,339
0,3747,3
690,2812,2989,3970,3853,3015,2934,1967,1915,2022
,1790,5466,5576,5478,5525,5423,5689,5364,5715,34
48,3500,
2879,2995,3737,3808,3639,3912,7684,7217,6944,654
6,6500,6451,6445,6561,6357,6712,6976,6732,4926,5
007,496
7,4735,2555,2937,3697,3310,3431,3529,3471,3859,3
032,2799,3663,3750,3506,3749,3421,3317,4984,4575
,5309,56
86,5042,4846,5065,4604,4957,4853,5066,5015,6330,
6790,6548,6371,3530,3738,3692,3435,1535,2012,202
5,1975,3
199,3263,3854,3479,3508,3698,3643,3537,2990,3044
,3753,3318,3019,2938,3779,3422,3671,3740,3862,35
32,3321,
3754,2557,2997,7040,6738,7242,7440,7328,7688,745
6,7696,6562,6446,6793,6915,7360,7712,6504,6683,3
645,348
3,3021,3048,2026,1917,1999,1918,2940,2998,3875,3
861,3781,3437,3512,3700,4971,4958,4854,5044,5796
,5481,58
26,5709,3761,3446,3495,3538,2911,2807,3865,3322,
3443,3553,3646,3485,3056,2558,3675,3438,6255,647
5,6358,6
453,5335,5906,5767,5468,5539,5526,5584,5800,5921
,5482,5710,5529,5690,5908,5717,5692,5339,5431,50
73,5019,
5828,5718,5721,5771,6332,6593,7238,7212,5541,591
2,5922,5731,7299,7249,6361,6552,3540,3727,3972,3
877,302
7,3001,3687,3756,3782,3501,3866,3324,2811,3022,3
445,3677,3920,3762,3002,2927,2033,1979,2028,2034
,5722,55
30,5351,5808,6753,6740,6695,6794,3029,3030,3785,
3704,3554,3878,3499,3976,3486,3295,3735,3764,198
1,2007,1
982,2011,2975,3043,3907,3691,3544,3527,3868,3881
,3786,3793,2813,3004,3909,3788,3936,3882,2935,30
33,3678,
3984,3794,3768,3449,3507,3889,3391,3045,3034,369
3,3884,3556,3502,6373,6303,6564,6454,5068,4857,5
773,536
8,6685,6917,6754,6801,6477,6263,6744,6483,5489,5
310,5484,5774,6362,6512,6796,6374,6535,6457,7218
,7241,57
79,5455,5600,5435,5341,5490,4973,5048,4591,4799,
5031,5074,4979,4858,4599,5021,6594,6686,7183,748
8,6478,6
377,6699,6918,4974,4831,5733,5542,6319,6267,7301
,7220,5545,5571,5089,4981,6802,6756,6485,6921,63
64,6458,
6568,6539,6817,6727,7191,7302,6499,6431,6327,637
8,5734,5663,5355,5532,5463,5492,5895,5437,3910,3
739,356
0,3311,3450,3531,3694,3699,6269,6701,6804,6760,7
552,7244,6486,6460,6385,6922,7305,7250,6707,6489
,6596,65
41,5342,5546,5573,5357,6547,6351,7224,7195,6818,
6702,6929,6576,6501,6331,7265,7207,7427,7252,638
0,6808,5
679,5953,5924,5832,5954,5781,5928,5899,6768,6731
,6924,6849,2991,2939,3509,3452,3046,2814,3890,35
33,6270,
6386,6709,6542,5035,5090,5737,5724,5553,5840,507
6,5022,5936,5956,5467,6017,5363,5782,5574,5438,7
306,731
3,6490,6600,7429,7197,6502,6549,5795,5738,4860,5
037,6018,5901,5063,4982,5496,5548,4927,5043,5785
,5856,56
87,5960,4603,4985,5745,5358,3568,3741,3751,3796,
2559,3036,3913,3701,2036,2023,2040,1791,3423,353
9,3510,3
809,3323,3534,3514,3513,3049,2999,3541,3319,3755
,3914,3810,3971,3050,2941,3742,3855,2013,2027,20
14,2029,
3023,2942,3921,3892,3800,4000,3863,3439,3973,370
2,3757,3916,6447,6713,6388,6739,5479,5577,5519,5
907,508

0,4847,5711,5798,5554,5797,5469,5365,3705,3783,3057,3003,3325,3763,3896,3974,6333,6710,6820,6505,7211,7266,6850,6733,5578,5786,5740,5483,5247,5311,5902,5527,5556,5746,5691,5585,5038,5092,5801,5366,6359,6930,7683,7256,5067,4986,5827,5470,5719,5788,5910,5580,5369,5802,4605,5045,5693,5531,5069,5096,4988,5046,5923,5909,7308,7198,6791,6492,6563,6550,6608,6824,6945,6506,6734,6553,6714,6932,6741,6716,6363,6455,7314,7239,7430,7433,6852,6742,6745,6795,7329,7744,7213,7268,6565,6936,3758,3812,3922,3447,3516,3542,3052,3058,6946,6755,6746,6554,7808,7219,6375,6832,5829,5485,5560,5748,7316,7214,6797,6392,3555,3487,3557,3977,3867,3545,3706,3816,6513,6334,6508,6798,6803,6479,7243,7434,5809,5494,5543,5586,6624,6459,6365,6514,4959,4855,5913,5370,7441,7685,7272,7330,5491,5601,5694,5533,5104,4606,5723,5486,6757,6566,6569,6595,6758,6687,6379,6556,3924,4032,3005,3031,3937,3765,3869,3978,6487,6516,7221,7361,6919,6461,6366,6570,3787,3879,3546,3708,3006,3035,3766,3326,5588,5775,6020,5925,5075,5049,5735,5804,3789,3647,3060,3047,3985,3870,3883,3451,6597,6381,6703,6977,7320,7245,7332,7936,7436,7442,6948,6856,6978,6805,6952,6923,1983,2035,2037,1919,3769,3503,3064,2815,6761,6748,6577,6864,5830,5549,5914,5372,4859,5070,5493,5725,5968,5810,5050,4975,5077,5078,5833,5752,6960,6980,6491,7041,3679,3561,3938,3795,3558,3980,3790,3885,7686,7222,7251,7225,6387,6806,7689,7280,5602,5926,5547,6024,6598,6462,6819,6762,5534,5343,5783,5812,5023,5091,5955,5739,5592,5575,5916,5929,7042,6925,6520,6572,6809,6880,6711,6984,5834,5841,4861,5052,5957,5836,5984,5930,4983,5081,5726,6032,6769,6382,7303,7246,5842,5816,5497,5555,5937,5439,5093,5082,7457,7362,7253,7444,7690,7226,6503,6601,5741,5932,5604,5550,3548,3928,3911,3797,3770,3986,3037,3051,6543,6931,6735,6822,5958,5787,5608,5359,3824,3940,3891,3886,3511,4001,3562,3695,6578,6821,7336,7307,5498,5579,5742,5747,7267,7254,6493,6389,6602,6810,6764,6507,6271,6335,6926,6551,5039,4987,5557,5500,5094,4862,5938,5581,6580,6770,7228,7448,2030,2038,2041,2042,3743,3811,3988,3535,7257,7458,7697,7692,5616,5789,5799,5844,3915,3453,3038,3053,3569,4002,3893,3798,4033,3944,3564,3703,3801,3772,3515,3813,6715,6609,7364,7309,6825,6390,6851,6494,7269,7315,7344,7310,4607,5084,5961,5749,5471,5587,5558,5857,6743,6812,6934,6604,7698,7489,7199,7368,5371,5582,5562,5561,5097,5047,5589,5367,5803,5962,5858,6019,3917,3992,3454,3894,3923,3802,3570,3952,6393,6826,7258,7713,5098,4989,5790,5903,5071,4990,5969,5940,5848,6048,5911,5487,6717,6555,6947,6933,6021,5750,5805,5964,3814,3517,3007,3059,2015,2044,2031,2039,6853,6509,6584,6772,5753,5831,5105,5051,5373,5811,5944,6022,6833,6518,6567,6610,6937,6394,6515,6625,7460,7490,7700,7431,3543,3707,4004,3759,3975,3897,3061,2943,7317,7270,7273,7472,6718,6557,6747,6510,6612,6799,7044,6949,5806,5860,5970,5495,7464,7331,7260,7215,5564,5590,5100,5106,3572,3918,3817,3898,3804,3518,4034,4008,5603,5535,5605,6025,7435,7553,7714,7492,6759,6828,6854,6573,7376,7554,6938,6396,3547,3925,3939,3709,3979,3559,3767,3818,3900,3825,3926,3929,3576,3871,3327,4036,6517,6749,6992,6834,7318,7321,6857,6776,5915,5593,5754,5864,6626,6950,6571,7048,5972,6080,5053,5079,6558,6367,7333,7274,5985,5813,5917,6026,5835,5927,5594,5756,6807,6836,6979,6763,7223,7496,7704,7745,3981,3791,3549,3987,3054,3062,3710,3820,6616,6599,6940,6953,7716,7281,7322,7247,5054,5083,5814,5374,5837,5695,5108,5095,6858,6865,7437,7276,6981,6860,7008,6954,6750,7056,6866,6840,7746,7392,7334,7687,4016,3941,3563,3771,3826,3930,3550,4040,6521,6579,6961,6463,6765,6956,6628,6574,6982,6811,7720,7363,7438,7809,7691,7443,3065,3066,3455,3982,3887,4048,3942,3989,6632,6383,6522,6603,6766,6771,7748,7459,7227,7337,6581,6524,6962,6605,6640,6813,6033,5918,5931,5499,5817,5551,5112,4863,6823,6868,6985,6773,5727,5609,5986,5843,3799,3565,3945,3773,4003,3828,3932,3571,7728,7282,7445,7324,7255,7365,6495,6611,5606,6028,5838,5933,5596,5976,5959,5845,6582,6881,6395,6606,6586,6585,7284,7338,5818,6034,5085,5099,5872,5988,5939,5934,5559,6049,5610,5743,5791,5859,6036,5583,7229,7699,7693,7810,7449,7446,7694,7345,3803,3895,3994,3946,3990,3574,4005,3815,59

63,5501,5086,5101,5617,6050,5941,5846,3832,3953,3566,3774,3993,3573,3948,3919,6613,6391,6827,6986,6081,5992,5612,5751,5849,5820,5563,5861,7461,7556,6882,7043,6814,6927,6993,6964,6872,7072,6935,6511,2043,2045,2046,2047,3039,3068,4064,3519,7045,6774,7259,7752,6829,6988,7937,7366,5965,6040,5502,5942,5971,5850,5618,6000,5862,5565,5055,5107,6777,6855,7340,7288,5591,5755,6052,5807,6023,5945,5109,4991,5620,5966,5865,5946,5852,5566,6082,6056,3805,3899,4006,3954,4009,4035,3819,3577,5595,5973,5987,5757,6027,5607,5815,5866,7369,7504,6397,6835,7230,7450,7311,7271,6968,7046,7346,7462,7261,7812,6830,6884,3927,3996,3806,3901,3055,3063,4037,4010,6994,6519,6588,6614,6627,6559,7370,7760,3956,3578,3821,4017,4038,3827,3931,4012,7491,7560,6629,7049,7465,7938,6939,6617,7275,7348,7319,7377,7452,7816,7262,7372,6778,6888,6996,7104,5948,5873,5974,5977,7466,7568,7776,7520,7493,7701,7323,7378,7009,6837,7473,7715,7468,7277,7352,7702,7705,7283,6941,7050,6859,6951,7335,7393,3902,3983,3943,3711,3960,3551,3067,3069,5624,5919,5375,6084,7494,7474,6618,6780,6838,6398,6861,6719,7057,6942,7940,7325,7824,7497,6955,6523,6841,6575,6751,6633,7010,6867,6630,7052,6029,5839,5597,6035,5102,5110,5758,5868,6064,5989,5611,5819,4018,3822,4041,3580,3933,3829,4042,3991,5874,5978,5598,6088,5113,5114,5503,6030,5935,6096,5990,6037,7278,7285,6862,6957,6620,7000,6983,6869,5847,5613,5993,5821,7380,7339,7944,7498,6842,7058,6896,7012,6963,6958,6583,7073,7394,7717,6634,6767,3947,3934,3830,4020,4049,3995,4044,3833,6815,6883,7060,6607,6987,6525,6641,7074,7706,7555,7476,7384,7584,7439,7447,7326,7505,7718,7840,7286,7500,7747,7708,7557,6051,5876,5980,5619,7341,7289,7721,7367,3949,4024,3567,3775,4007,4050,3955,3834,6965,6870,7952,7347,5851,5943,6042,5994,7396,7506,7480,7872,7105,7016,7558,7342,3575,3997,3950,3807,4065,3957,4011,4066,6636,6775,7722,7749,6873,6844,6587,6885,7561,7451,7290,7616,6038,5622,6053,5863,7521,7729,7371,7231,5880,6001,5614,5822,4052,3998,3836,4013,4039,3958,3903,4019,6989,7064,6526,6966,6041,5621,5996,5967,7508,7562,7695,7750,7724,7349,7463,7453,5087,5116,6112,5567,7400,7292,6995,6874,6642,7024,6886,6589,6615,6779,7373,7350,5853,5947,6054,6002,7811,7730,7454,7753,7076,6831,7467,7522,7047,6969,6644,6990,6889,6970,7379,7569,7353,7564,6876,6590,3070,3071,3579,3961,4056,3823,4014,4068,7106,7080,6619,6997,7512,7754,7011,6781,7051,6631,7813,7761,7703,7408,6839,6890,6057,6083,5867,5625,7374,7263,6972,6897,5975,6044,5854,5949,7495,7732,6998,7001,7968,7570,7524,7475,7469,7585,6648,6943,6399,7108,7381,7736,5103,5111,6085,6058,8000,7756,7053,6863,6004,5626,5869,6065,4043,3962,3581,4021,4045,4072,3964,4022,6086,5875,5979,6060,7354,7814,7572,7395,8064,7762,6621,7059,6782,6892,7586,7470,7817,7939,7088,7013,6635,6843,6898,7002,5950,6031,5991,5759,7528,7707,6622,7112,6527,7054,6959,7120,7279,7499,7014,7061,6008,5599,5115,5117,7382,7477,6871,6637,7017,6845,7356,7617,7385,7576,7777,7764,6066,5870,6089,5628,7719,7818,7397,7327,7588,7478,7075,6900,7709,7941,7004,6643,5981,5877,6090,6039,6875,6967,7778,7825,7501,7287,7768,7507,5995,5982,5878,6068,3935,3831,4080,3582,4051,4025,3835,4046,6097,6043,6092,5881,7386,7536,7820,7398,7066,7018,7559,7481,7062,6646,7618,7710,7077,6887,6904,7025,7502,7401,7723,7942,4026,3951,4053,4054,3999,4067,3837,4028,5997,6072,5615,5823,7343,7291,7826,7780,6638,6846,7065,6645,7509,7945,7388,7482,7592,7563,7841,7751,6055,6098,6003,5882,7523,7455,7351,7402,7293,7725,7828,7784,5623,6045,5998,5855,7510,7484,7409,7946,7731,7513,7620,7565,7020,6991,7136,6591,7571,7375,6877,6971,6113,6005,6059,6114,7842,7726,7953,7600,7078,7026,7081,7107,7525,7355,7404,7832,6891,6649,6999,7068,6878,6973,7109,7082,7792,7755,7948,7873,6100,6046,5884,6061,7028,6650,6893,7089,6087,6006,5951,6067,7294,7410,7110,6899,7003,7084,7733,7566,7514,7624,7526,7573,5118,5119,5627,6009,7471,7737,7412,7763,3959,4057,4069,4058,4015,3963,4070,3838,6974,7055,7015,6783,7032,6623,7357,7734,7090,6894,7113,6652,7005,6901,7114,7063,6104,5871,6062,6116,7019,7006,6902,7092,7844,7529,7874,7757,7383,7954,7815,7516,6091,6010,5629,6069,7587,7574,7632,7848,3583,4060,4073,4023,4074,3965,4047,3966,6093,6120,6012,6070,7969,7530,7758,7577,7738,7956,7765,7740,7387,7479,7121,7067,7876,7766,7769,7819,7589,7960,7970,7779,7770,7578,7399,7856,5983,5879,6128,5630,7116,6905,7821,7416,7537,7358,7532,7822,7827,7503,7648,7483,7389,7538,7021,7096,6639,6847,7079,7122,6099,6073,5883,6094,7027,6906,6647,7069,7022,6879,7781,7590,7593,7619,7137,7029,7782,7711,7403,7580,7511,7540,7943,7485,6074,5999,6101,6102,7390,7594,7621,7405,7727,8001,7972,7880,8002,7829,7976,7947,7083,7138,7785,7772,6047,6115,5885,6076,7601,7888,7124,7070,7984,8004,7515,8065,6007,6105,6117,6106,7411,7830,7622,7486,7843,7786,6908,7085,4081,4027,4076,4082,4029,4055,4030,4059,8066,7949,7111,7030,6063,6011,6118,5886,7544,7596,6975,7091,7833,7904,7735,8008,6651,7033,7793,7406,7527,7625,7567,7955,7128,6895,7759,7846,7602,7845,7517,7413,7626,7834,7788,7531,5631,6108,6121,6071,7295,7359,7950,7575,7604,7794,7739,7633,7086,7140,7849,7414,7115,7034,7875,7518,4084,4071,4088,3839,4061,4075,4062,4077,7767,7836,7958,7628,7417,7850,6653,7093,7741,7579,7117,7144,6122,6013,6095,6014,7036,7094,7971,7957,7877,7533,7608,7796,7857,7542,7591,7634,7007,6903,7961,7418,7539,7649,7742,7581,7152,6654,7771,7534,7636,7823,8068,7973,7123,7097,7783,7852,7878,7597,7962,7420,6907,7118,7541,7773,8016,7858,7098,7023,6129,6075,6124,6130,4031,4083,4085,3967,4078,4086,4089,4090,7125,7126,7881,7800,7650,7974,7595,8072,7582,7391,7831,7860,6077,6103,6078,6107,7071,7139,8003,7787,7640,7623,7964,7977,7882,7889,6909,7100,8005,7884,8032,7978,7031,7129,7774,8080,7890,7864,7545,7603,7985,7487,7141,7130,7789,7980,7652,7598,8006,7835,7656,7407,7546,7627,7790,7795,7087,7035,7605,7548,7142,6910,7986,7629,7664,7837,7847,7892,6655,7132,8009,7797,6132,6119,6136,5887,7519,7635,7606,7905,7419,7630,7610,7609,7145,7095,7637,7415,7851,8010,7906,8067,7146,7037,7838,7951,6109,6123,6110,6125,7119,7038,8017,7988,7896,8096,7959,7535,8069,7798,7853,8012,7801,7879,7153,7099,7421,7859,7992,8070,7854,7908,8018,7543,7612,7638,7148,7154,7651,7583,7653,8073,7963,7641,7802,7912,8020,8128,7101,7127,8033,7861,7965,8074,7883,7975,7642,7804,7102,7131,7862,7422,7885,7743,7156,7143,8081,7966,7979,7547,4063,4092,4079,4087,4091,4093,4094,4095,6079,6131,6133,6015,7865,7599,7160,6911,7775,7657,8034,7891,7654,8076,7886,7981,7644,8024,8007,7893,7866,8082,7133,7147,7920,8036,7987,7982,7607,8097,7658,7791,6126,6134,6137,6138,7839,7907,8084,7631,8011,7549,7134,7149,7665,8098,7989,7894,8129,8040,7660,7799,7897,7868,7611,7909,8013,8088,7550,7990,8019,7898,7666,8048,7910,7613,7103,7155,6111,6140,6127,6135,7639,7803,8100,7855,8071,7993,7157,7039,7668,8014,7913,7994,7900,7614,8130,8104,7643,8021,8035,7805,8075,7655,7863,7914,7996,7921,8022,8025,7672,7967,7423,8132,8077,7887,7645,8083,7150,7158,7806,7916,8112,8037,7659,7867,7922,8026,7646,8136,7161,7162,7551,8078,7983,8144,8038,8085,7895,7661,8041,7869,8099,7924,8028,7667,7899,7991,8090,8042,8086,7670,8101,7911,7928,8049,7662,7870,8089,7669,8044,8015,6139,6141,6142,6143,7135,7164,8160,7615,7901,7995,8102,8050,8105,8131,7915,7673,8023,8092,7902,7997,7151,7159,8133,8106,8052,7674,7917,8113,8134,7923,8027,8108,7998,8079,8039,7807,8056,7647,7163,7165,8114,7918,8137,7676,8029,7925,8138,8087,8043,8030,7926,8116,8145,8091,8140,7929,8045,8120,7663,7871,8103,8146,8051,7930,7671,8093,8046,7903,8161,8053,8107,8162,8148,8094,7932,8109,8135,8054,7999,8115,7166,7167,7675,8057,8152,7919,8110,8164,8139,8058,7677,8117,8141,8168,8060,8118,8031,7927,8176,7678,8147,8121,7931,8142,8122,8047,8149,8150,8095,8163,7933,8124,8055,8153,8165,8154,8111,8059,8166,7934,7679,8156,8169,8119,8170,8061,8143,8062,8177,8123,8172,8178,8125,8151,8126,8155,8180,8167,8184,7935,8157,8171,8158,8173,8127,8179,8181,8063,8174,8182,8185,8186,8159,8188,8175,8183,8187,8189,8 190,8191]

**Sequence group 1: Z1_8192**

[0,1,2,7,3,8,11,24,4,10,13,28,16,33,35,78,5,12,14,32,19,38,47,82,22,46,42,91,59,99,107,182,6,17,21,40, 23,45,51,93,29,57,61,100,73,118,123,197,34,63,76,12
1,81,132,147,214,90,149,159,252,164,264,298,425,9,
18,26,56 ,30,60,72,113,36,77,64,126,85,137,153,229,
44,75,89,148,95,156,163,260,103,166,184,288,196,30
6,322,489,53,92,1
01,162,119,176,191,303,130,192,213,314,231,335,36
2,544,151,227,255,343,262,363,385,589,295,391,412,
609,441,
632,676,932,15,25,31,74,39,80,83,152,48,88,96,161,1
06,171,179,302,58,97,112,177,122,190,206,318,136,2
07,228,
330,257,357,381,577,66,116,131,195,140,212,236,35
2,160,253,263,365,294,390,403,608,178,275,304,395,
315,431,
443,630,340,462,508,665,560,696,761,933,70,133,15
5,239,170,261,291,393,183,296,308,424,323,442,488,
649,202,
319,331,456,364,504,546,704,375,566,592,732,620,7
74,802,1089,233,353,368,511,396,576,595,754,440,6
05,631,7
94,670,805,889,1165,479,640,677,844,694,927,957,1
241,759,988,1021,1218,1071,1286,1409,1800,20,37,4
1,94,49,
98,114,189,50,115,127,198,144,230,242,379,65,128,1
45,245,157,256,273,380,165,272,299,407,320,439,44
6,629,68 ,154,167,247,186,280,305,438,194,312,324,
450,334,498,529,692,193,332,355,497,374,547,579,7
33,398,597,621,77
3,639,801,853,1147,79,181,187,310,201,328,354,490,
215,359,367,545,386,588,604,765,297,382,397,591,4
26,614,6
38,796,468,645,682,838,715,926,959,1198,327,414,4
51,628,496,664,686,910,534,699,725,931,762,997,10
43,1263,
593,760,775,1022,797,1072,1009,1321,866,1144,116
6,1419,1179,1481,1590,1852,84,199,203,373,281,389
,402,596 ,311,406,427,623,463,647,679,912,325,457,
495,648,510,687,717,935,567,727,751,993,795,1041,
1088,1325,378,49
9,528,716,578,746,781,1010,622,782,803,1082,867,1
067,1151,1433,655,834,916,1145,944,1178,1216,146
6,998,12
29,1228,1578,1322,1663,1703,2051,413,561,600,783,
646,804,852,1105,683,911,928,1167,979,1181,1219,1
479,718 ,953,1011,1199,1044,1240,1323,1664,1104,1
343,1406,1706,1452,1818,1850,2161,772,1023,1080,
1324,1150,1338,
1438,1713,1164,1435,1474,1828,1560,1879,1984,234
0,1182,1482,1660,1919,1694,1987,1941,2346,1782,2
089,211
7,2540,2167,2622,2757,3076,27,43,52,102,62,129,14
6,237,67,150,158,244,169,266,274,428,69,168,180,26
5,188,32
9,341,478,224,342,372,535,388,580,601,793,71,185,2
00,333,226,369,383,574,238,392,404,606,430,633,65
3,806,25
4,415,445,644,491,678,697,878,505,693,728,952,731,
992,1040,1411,117,225,232,387,246,405,429,625,289
,447,46
9,673,507,703,726,914,309,475,513,695,573,730,739,
976,590,740,750,1042,833,1073,1132,1434,326,572,5
82,749,
613,780,792,1064,635,832,855,1099,930,1148,1168,1
475,672,888,945,1169,999,1187,1273,1561,1079,128
0,1352,1
665,1407,1711,1820,2159,120,243,267,444,307,474,5
09,714,321,530,575,741,594,758,763,1045,358,583,6
12,764,6
34,829,845,1096,671,876,929,1153,977,1183,1252,14
76,384,624,652,854,698,917,915,1184,719,956,989,1
242,106
5,1276,1318,1673,755,1008,1075,1287,1097,1381,14
08,1730,1135,1432,1460,1829,1577,1881,1985,2341,
399,675,
702,958,738,996,1066,1281,815,1078,1116,1396,112
9,1410,1450,1811,835,1117,1134,1437,1185,1455,15
41,1878,1
260,1576,1619,1920,1702,2054,2092,2357,877,1217,
1246,1477,1319,1579,1662,1953,1353,1696,1731,208
8,1821,2
118,2165,2569,1462,1739,1830,2123,1911,2185,2210
,2737,1954,2285,2345,2840,2518,2910,3041,3447,14
1,290,31
3,531,356,581,607,800,366,615,641,831,674,865,934,
1253,394,654,705,913,729,995,978,1262,747,1020,10
70,1342 ,1106,1390,1413,1783,494,724,748,994,814,
1047,1081,1397,830,1107,1131,1418,1149,1451,1465
,1854,836,1146,1
180,1464,1255,1540,1591,1921,1296,1693,1697,2055
,1738,2093,2156,2534,506,807,828,1098,837,1128,11
52,1454 ,879,1186,1243,1480,1277,1588,1695,2049,1
074,1254,1320,1618,1354,1707,1742,2090,1453,1743
,1831,2124,1918 ,2184,2209,2736,1130,1380,1436,17
10,1463,1827,1874,2158,1549,1880,1937,2208,2048,
2338,2356,2847,1661,195
5,2061,2344,2116,2367,2531,2916,2160,2541,2613,3
021,2628,3109,3113,3631,512,839,864,1247,1046,12
72,1297,
1692,1083,1339,1391,1712,1439,1810,1853,2157,113
3,1412,1461,1819,1478,1875,1940,2187,1589,1986,1
936,225
5,2091,2347,2499,2892,1261,1467,1483,1910,1672,1
952,2060,2342,1705,2062,2095,2492,2125,2519,2596
,3020,18
26,2119,2164,2535,2211,2623,2629,3097,2339,2781,
2846,3167,2911,3290,3344,3618,1355,1548,1704,206
3,1801,2
094,2122,2530,1851,2166,2186,2612,2284,2626,2841
,3112,1855,2254,2343,2780,2498,2848,2849,3291,25
68,2917,
2931,3345,3077,3506,3546,4152,2050,2366,2493,289
3,2597,2930,3040,3351,2627,3096,3108,3507,3246,3
547,386
4,4268,2756,3166,3247,3619,3350,3630,3865,4269,3
446,3876,3877,4442,4153,4443,4840,4841,54,55,86,1
25,87,13

4,139,292,104,138,143,316,234,339,361,602,105,142,204,338,241,376,437,626,282,436,432,651,473,685,713,982,1
24,235,259,400,283,435,459,667,317,471,477,700,563,744,757,1051,360,493,598,753,611,798,841,1100,650,843,9
09,1176,946,1232,1292,1587,135,240,300,470,336,476,562,735,370,599,514,766,637,809,891,1115,434,565,643,84
2,669,902,925,1196,707,948,990,1274,1050,1316,1350,1737,461,666,701,924,745,960,1037,1295,778,1038,1091,1
344,1119,1385,1448,1872,847,1113,1193,1389,1230,1449,1531,1925,1283,1537,1582,1973,1617,2020,2120,2588,2
05,293,337,564,377,610,627,890,448,642,680,919,712,955,963,1294,472,681,734,961,756,1036,1076,1346,808,107
7,1114,1370,1195,1415,1503,1907,516,742,779,1049,810,1090,1138,1398,918,1177,1231,1457,1282,1536,1551,19
72,962,1239,1298,1543,1345,1613,1667,2018,1386,1700,1812,2065,1882,2162,2305,2589,532,799,901,1155,954,1
197,1279,1539,983,1284,1326,1586,1351,1666,1736,2053,1068,1347,1371,1698,1456,1802,1876,2220,1487,1884,1
932,2252,1990,2336,2440,2889,1137,1399,1472,1815,1544,1906,1935,2274,1616,1969,2019,2386,2066,2443,2543,
2983,1729,2026,2121,2504,2134,2575,2599,3099,2287,2620,2739,3092,2807,3168,3347,3802,258,371,401,668,449 ,684,736,1035,458,737,767,1052,812,1118,1156,1501,515,776,813,1159,903,1194,1237,1502,947,1236,1293,1581,
1348,1615,1670,2017,518,900,949,1171,1032,1244,1299,1614,1048,1340,1364,1674,1384,1780,1823,2132,1039,13
82,1405,1779,1486,1877,1909,2253,1546,1939,1991,2335,2025,2391,2507,2929,603,981,1033,1336,1055,1368,140
4,1740,1101,1417,1459,1873,1532,1924,1968,2333,1285,1528,1545,1927,1608,1988,2024,2388,1708,2029,2128,25
02,2223,2574,2615,3080,1367,1584,1675,2016,1778,2064,2130,2564,1848,2213,2237,2587,2306,2697,2759,3119,1
933,2304,2337,2752,2389,2842,2713,3231,2532,2926,2988,3443,3023,3545,3610,3878,636,1053,1069,1485,1245,1
535,1550,1938,1337,1580,1609,2009,1701,2031,2127,2566,1365,1699,1777,2052,1814,2131,2233,2591,1885,2239,
2273,2625,2387,2755,2888,3249,1500,1781,1822,2232,1908,2264,2359,2714,2008,2364,2441,2866,2533,2805,296
7,3445,2059,2496,2572,2927,2592,3022,3082,3512,2698,3095,3094,3562,3244,3617,3637,4155,1583,1883,1942,23
65,2030,2442,2506,2897,2129,2565,2584,2989,2619,3043,3093,3519,2234,2595,2715,3081,2776,3098,3245,3624,2
896,3281,3302,3680,3468,3862,3874,4441,2334,2753,2864,3248,2966,3250,3464,3685,2982,3453,3514,3870,3558,
3917,4134,4618,3060,3548,3614,4075,3632,4141,4125,4664,3800,4235,4277,4842,4491,4906,4959,5364,301,433,4
60,706,492,777,840,1139,517,846,908,1158,951,1234,1238,1610,519,950,980,1233,1034,1369,1387,1728,1102,138
8,1484,1849,1534,1916,1943,2385,533,991,1054,1383,1112,1473,1529,1904,1154,1538,1562,1970,1612,2021,2057 ,2460,1192,1585,1669,2028,1741,2126,2163,2538,1803,2133,2248,2594,2251,2624,2754,3349,743,1103,1136,1533 ,1170,1563,1611,2011,1275,1671,1709,2097,1809,2215,2238,2570,1327,1715,1817,2135,1887,2250,2257,2616,192
6,2258,2272,2758,2495,2843,2918,3452,1366,1886,1922,2267,1975,2358,2384,2782,2023,2494,2517,2895,2586,29
64,2990,3515,2096,2542,2593,2991,2699,3079,3157,3559,2851,3164,3282,3625,3303,3683,3866,4419,752,1157,12
35,1668,1317,1714,1813,2222,1349,1824,1905,2259,1934,2286,2307,2777,1416,1923,1974,2332,2022,2473,2505,2
890,2067,2536,2585,2981,2617,3061,3110,3516,1530,2010,2056,2516,2212,2573,2571,3062,2235,2598,2621,3100,
2783,3158,3228,3627,2275,2712,2845,3169,2891,3297,3346,3686,2925,3444,3504,3871,3561,3919,4135,4619,154
7,2099,2214,2614,2256,2696,2804,3165,2463,2850,2908,3300,2913,3348,3466,3861,2497,2909,2924,3455,3063,34
71,3551,3916,3116,3560,3613,4084,3636,4176,4250,4667,2537,3083,3102,3517,3229,3563,3616,4127,3283,3634,3
687,4234,3867,4278,4489,4881,3508,3741,3872,4281,4073,4545,4558,4957,4132,4563,4655,5038,4778,5170,5295,
5779,811,1278,1341,1825,1414,1917,1971,2390,1458,1989,2027,2475,2098,2529,2590,3111,1542,2058,2221,2567,
2249,2631,2618,3118,2265,2738,2806,3280,2898,3298,3441,3801,1776,2236,2266,2630,2462,2779,2865,3301,247
4,2899,2915,3442,2965,3467,3511,3896,2500,2928,3042,3510,3115,3550,3611,4085,3170,3629,3635,4177,3740,42
51,4416,4786,1808,2461,2472,2894,2501,2912,2980,3470,2539,3078,3101,3544,3159,3608,3633,4143,2844,3114,3
230,3612,3288,3681,3742,4248,3469,3743,3873,4282,4074,4544,4557,4956,2914,3296,3454,3682,3509,38

69,3898,4418,3557,3918,4087,4556,4142,4616,4666,5109,3615,4133,4179,4654,4276,4693,4785,5180,4440,4843,4905,5293,4914,5413,5415,6051,1816,2503,2528,3103,2778,3156,3171,3628,2867,3251,3299,3684,3465,3860,3879,4417,2919,3440,3505,3863,3518,3899,4124,4547,3609,4140,4086,4561,4249,4665,4777,5168,3117,3513,3549,4072,3626,4126,4178,4652,3639,4232,4271,4694,4283,4779,4882,5292,3868,4279,4488,4787,4559,4907,4915,5367,4617,5037,5108,5509,5171,5532,5534,6048,3289,3556,3638,4233,3803,4270,4280,4784,3875,4490,4546,4904,4562,4912,5039,5414,3897,4560,4653,5036,4776,5110,5111,5533,4880,5181,5183,5535,5365,5800,5802,6324,4154,4692,4695,5169,4883,5182,5294,5777,4913,5366,5412,5801,5510,5803,6216,6326,4958,5508,5511,6049,5776,6050,6217,6327,5778,6218,6219,6672,6325,6673,6674,6675,108,109,110,175,111,208,211,284,172,210,249,408,268,453,455,722,173,248,250,452,271,466,551,770,278,550,502,823,619,851,875,1190,174,269,277,500,279,549,571,825,409,617,657,868,709,898,907,1257,454,659,720,905,769,968,1015,1314,822,1017,1095,1420,1140,1468,1558,1957,209,270,286 ,616,410,656,708,893,464,721,660,922,817,973,1085,1361,548,711,821,1016,827,1092,1111,1444,871,1142,1220,1496,1256,1622,1678,2113,585,824,869,1110,899,1172,1227,1567,966,1248,1313,1646,1363,1723,1786,2216,1019,1359,1423,1735,1446,1787,1869,2301,1555,1891,1928,2361,2005,2408,2488,3016,251,285,411,710,467,768,771,1084,568,820,848,1109,874,1163,1175,1566,618,849,892,1173,906,1226,1302,1658,972,1303,1360,1718,1441,1749,1865,2281,662,896,967,1251,984,1312,1376,1744,1108,1421,1447,1789,1554,1890,1903,2360,1174,1491,1620,1895,1647,1979,2007,2382,1732,2070,2188,2453,2260,2576,2705,3017,690,969,1087,1379,1162,1445,1499,1893,1191 ,1556,1640,1956,1679,2006,2112,2445,1290,1659,1719,2036,1788,2152,2218,2608,1859,2270,2308,2672,2372,2718,2774,3293,1373,1745,1804,2191,1896,2280,2311,2694,2004,2353,2383,2766,2458,2785,2921,3409,2103,2416,2489,2860,2562,3011,3069,3553,2703,3104,3177,3474,3263,3690,3825,4264,276,465,501,826,569,850,894,1225,570,895,923,1258,1012,1362,1394,1863,661,964,1013,1401,1093,1440,1489,1864,1141,1488,1559,1915,1676,2003,2014,2381,688,1086,1143,1403,1222,1492,1621,2002,1250,1644,1688,2034,1722,2150,2201,2560,1249,1720,1747,2149,1858,2219,2283,2673,1898,2329,2373,2717,2415,2773,2869,3395,723,1189,1223,1642,1289,1716,1746,2114,1315,1751,1791,2217,1870,2300,2352,2709,1557,1866,1897,2303,1958,2370,2414,2768,2072,2421,2510,2854,2635,3010,3071,3462,1691,1930,2035,2380,2148,2452,2514,2962,2206,2579,2665,3015,2706,3161,3223,3575,2309,2704,2719,3178,2769,3272,3173,3713,2902,3392,3410,3851,3419,4005,4138,4432,816,1259,1291,1857,1493,1889,1902,2328,1643,1914,1959,2375,2071,2423,2491,2976,1689,2037,2147,2444,2190,2515,2637,3019,2271,2667,2691,3153,2767,3221,3292,3717,1862,2151,2200,2636,2282,2686,2761,3174,2374,2762,2775,3286,2903,3259,3399,3853,2451,2802,2984,3393,3044,3418,3472,3962,3162,3477,3476,4102,3714,4171,4215,4687,1929,2261,2348,2763,2422,2784,2868,3321,2511,2963,3012,3411,3087,3421,3475,4003,2638,3065,3175,3463,3224,3552,3715,4172,3320,3727,3806,4218,3912,4370,4422,4853,2716,3179,3284,3716,3398,3722,3858,4225,3408,3855,3966,4404,4096,4447,4624,5032,3422,4006,4168,4543,4190,4627,4597,5042,4262,4733,4781,5328,4875,5390,5445,5772,287,503,584,870,658 ,965,1014,1377,663,1018,1094,1400,1161,1470,1490,1976,689,1160,1188,1469,1224,1717,1733,2102,1356,1734,1856,2207,1888,2296,2349,2765,691,1221,1288,1721,1358,1805,1867,2278,1378,1892,1912,2354,1978,2409,2449,2786,1422,1931,2013,2420,2115,2490,2577,2906,2153,2561,2668,3064,2671,3152,3220,3827,897,1357,1372,1871,1402,1913,1977,2377,1497,2015,2073,2477,2155,2583,2666,2978,1641,2079,2193,2563,2277,2670,2679,3084,2302,2680,2690,3222,2801,3273,3376,3854,1690,2276,2298,2689,2369,2760,2764,3256,2411,2800,2871,3315,3014,3396,3412,3967,2476,2920,3045,3413,3163,3451,3577,4097,3279,3620,3736,4173,3807,4223,4372,4851,904,1395,1471,2012,1623,2078,2189,2634,1677,2202,2279,2681,2310,2702,2707,3225,1750,2299,2368,2708,2410,2797,2861,3312,2459,2904,3013,3401,3085,3423,3568,4000,1868,2376,2448,2870,2578,2985,2979,3448,2639,3068,3105,3554,3257,3580,3710,4185,2695,3172,3275,3691,3313,3761,3824,4230,3379,3852,3956,4405,4101,4481,4625,5033,1899,2479,2582,3070,2678,3160,3258,3621,2795,3278,3352,3780,3357,3826,3902,4275,2803,3353,3378,3857,3449,3915,4081,4446,3572,4100,4159,4548,4214,4690,4744,5045,2905,3473,3566,4001,3711,4103,4170,4609,3737,4208,4231,4732,4373,4782,4873,5337,3958,4239,4406,4791,4539,4877,4886,5437,4610,4961,5041,5500,5286,5546,5717,6055,985,1498,1645,2203,1748,2297,2355,2772,1790,2371,2417,2799,2478,2901,3018,3569,1894,2450,2609,2977,2669,3155,3086,3574,2687,3176,3262,3726,3322,3778,3829,4263,2146,2664,2688,3154,2794,3227,3285,3781,2798,3323,3359,3850,3397,3903,3961,4434,2852,3394,3420,3960,3571,4080,4139,4549,3704,4189,4209,4691,4238,4745,4848,5306,2154,2787,2796,3314,2853,3356,3400,3914,2907,3450,3555,4004,3581,4136,4191,4685,3274,3570,3712,4158,3738,4219,4254,4734,3913,4255,4407,4808,4542,4876,4885,5436,3358,3760,3856,4222,3959,4403,4438,4850,4093,4480,4593,4884,4684,5022,5044,5507,4169,4611,4717,5040,4780,5091,5291,5552,4852,5329,5381,5713,5416,5797,5805,6359,2192,2855,2900,3567,3226,3576,3705,4188,3287,3723,3779,4224,3859,4274,4433,4849,3377,3828,3957,4371,4002,4439,4596,4879,4137,4626,4592,4927,4735,5043,5175,5536,3573,3963,4007,4538,4184,4608,4716,5034,4217,4718,4747,5132,4809,5287,5376,5712,4402,4783,4872,5307,4887,5391,5417,5789,5023,5493,5506,5835,5547,5994,6012,6322,3739,4092,4216,4719,4265,4746,4790,5290,4423,4874,4878,5380,4960,5410,5501,5804,4435,4926,5035,5492,5174,5520,5521,5995,5336,5553,5563,6013,5773,6166,6234,6676,4686,5090,5133,5537,5377,5562,5716,6027,5411,5788,5796,6167,5926,6235,6468,6756,5444,5834,5927,6323,6026,6358,6469,6757,6054,6528,6529,6830,6677,6831,7080,7081,586,587,818,921,819,970,975,1552,872,974,987,1656,1374,1727,1785,2350,873,986,1300,1726,1393,1860,2001,2378,1494,2000,1980,2447,2077,2513,2633,3090,920,1375,1443,1900,1495 ,1983,2039,2455,1657,2075,2101,2580,2263,2684,2701,3243,1784,2145,2330,2693,2363,2770,2857,3316,2446,2859,2961,3416,3046,3520,3692,4131,971,1392,1564,2074,1724,2100,2262,2675,1806,2331,2194,2710,2413,2789,2923,3327,1982,2269,2419,2858,2457,2934,3009,3460,2611,3056,3106,3578,3242,3708,3734,4237,2069,2454,2581,3008,2685,3072,3217,3695,2742,3218,3295,3728,3355,3765,3900,4436,2863,3325,3457,3777,3478,3901,4051,4553,3623,4077,4122,4621,4157,4660,4788,5368,1301,1553,1725,2268,1861,2362,2379,2922,2032,2418,2508,2987,2632,3067,3075,3694,2076,2509,2674,3073,2700,3216,3276,3730,2788,3277,3326,3750,3459,3831,4047,4495,2196,2682,2743,3241,2790,3294,3382,3782,2986,3417,3479,3953,3622,4076,4095,4620,3074,3527,3706,4083,3729,4149,4175,4658,3766,4212,4284,4729,4482,4854,4965,5369,2204,2771,2933,3403,3066,3461,3583,4079,3091,3688,3718,4130,3735,4174,4236,4689,3260,3731,3751,4210,3952,4266,4444,4892,4043,4484,4564,4924,4630,5020,5120,5529,3381,3783,3964,4287,4088,4494,4567,4954,4156,4613,4659,5094,4730,5123,5331,5659,4229,4670,4789,5280,4846,5343,5379,5791,4963,5388,5439,5784,5499,5836,6015,6422,1442,1807,1901,2456,2033,2512,2676,3183,2038,2677,2711,3252,2792,3354,3404,4045,2195,2740,2793,3407,2935,3458,3525,4046,3047,3524,3693,4121,3732,4151,4182,4657,2198,2932,3057,3415,3180,3564,3707,4150,3240,3724,3744,4186,3764,4260,4375,4844,3219,3762,3805,4259,4042,4445,4537,4925,4090,4595,4631,5019,4669,5107,5283,5561,2351,3089,3181,3720,3255,3748,3804,4252,3317,3849,3955,4437,4052,4552,4612,5017,3689,4048,4089,4555,4144,4628,4668,5104,4220,4681,4812,5178,4895,5342,5383,5780,3747,4128,4187,4656,4258,4728,4814,5332,4420,4889,4917,5363,4966,5421,5447,5811,4565,4964,5021,5440,5105,5502,5433,5923,5304,5558,5660,6031,5715,6233,6290,6530,2412,3253,3261,4041,3565,4055,4094,4594,3721,4120,4145,4649,4213,4683,4811,5334,3745,4211,4257,4688,4286,4815,4909,5371,4485,4919,4953,5409,5095,5443,5528,5945,4044,4261,4374,4908,4536,4940,5047,5434,4648,5088,5121,5526,5305,5497,5567,6053,4715,5172,5340,5559,5372,5714,5782,6180,5422,5787,5786,6246,5924,6321,6389,6679,4123,4483,4598,5089,4682,5122,5282,5541,4813,5333,5360,5661,5387,5719,5785,6223,4910,5375,5435,5781,5488,5790,5925,6352,5540,5949,6010,6408,6160,6466,6510,6829,5018,5441,552

4,5944,5566,5946,6084,6413,5658,6081,6182,6506,6
242,656
9,6642,6962,5768,6236,6294,6575,6384,6645,6629,6
984,6420,6727,6769,7082,6875,7146,7243,7440,1565
,1981,20
68,2610,2144,2741,2856,3383,2197,2862,2960,3406,
3059,3522,3526,4146,2199,3058,3088,3521,3182,374
9,3767,4
228,3318,3776,4040,4421,4054,4540,4599,5093,2205
,3107,3254,3763,3324,3965,4049,4492,3402,4078,40
98,4614,
4148,4661,4713,5124,3456,4129,4181,4680,4253,481
0,4855,5310,4267,4845,4920,5374,4923,5408,5442,6
025,268
3,3319,3380,4053,3414,4099,4147,4651,3579,4183,4
221,4749,4273,4891,4918,5338,3719,4227,4369,4847
,4487,49
22,4937,5384,4554,4938,4952,5446,5135,5503,5554,
6080,3746,4486,4550,4943,4623,5046,5092,5494,466
3,5134,5
285,5539,5362,5564,5662,6183,4748,5330,5373,5663
,5423,5775,5813,6243,5523,5832,5950,6353,6011,64
11,6470,
6827,2692,3405,3523,4180,3709,4226,4285,4894,373
3,4400,4493,4939,4566,4962,4967,5489,3848,4551,4
622,501
6,4662,5129,5281,5530,4731,5308,5361,5657,5385,5
769,5798,6220,4050,4650,4712,5284,4888,5341,5339
,5770,49
11,5378,5389,5792,5495,5814,5920,6355,4955,5432,
5505,5837,5531,5997,6014,6414,5557,6052,6164,650
7,6245,6
571,6643,6963,4091,4751,4890,5382,4936,5420,5496
,5833,5127,5522,5544,6008,5549,6024,6086,6465,51
73,5545,
5556,6083,5771,6163,6239,6568,5808,6244,6293,662
4,6388,6720,6754,6987,5309,5783,5794,6221,5921,6
247,632
0,6631,5951,6386,6415,6726,6471,6770,6873,7085,6
176,6417,6508,6773,6573,6877,6922,7241,6640,6927
,6967,72
46,7018,7278,7399,7635,2791,3582,3725,4401,3830,
4541,4615,5106,3954,4629,4671,5131,4750,5289,537
0,5799,4
082,4714,4893,5335,4921,5419,5386,5810,4941,5438
,5498,5948,5542,5998,6029,6421,4256,4916,4942,54
18,5126,
5491,5525,6009,5130,5543,5551,6030,5565,6087,617
9,6532,5176,5560,5718,6178,5807,6238,6291,6625,5
838,635
7,6387,6721,6416,6755,6824,7022,4272,5125,5128,5
538,5177,5548,5656,6162,5311,5774,5793,6232,5815
,6288,63
85,6647,5504,5806,5922,6292,5992,6409,6418,6752,
6161,6419,6509,6774,6574,6876,6921,7240,5550,599
6,6082,6
410,6177,6505,6534,6826,6241,6570,6627,6920,6646
,6960,6986,7273,6295,6641,6723,6966,6768,6989,70
21,7392,
6828,7083,7145,7397,7150,7445,7447,7707,4368,517
9,5288,5795,5490,5812,5839,6356,5527,5947,5999,6
412,608
5,6464,6531,6825,5555,6028,6165,6467,6222,6535,6
628,6879,6289,6644,6626,6925,6753,6985,7017,7276
,5809,61
81,6237,6572,6354,6630,6722,6964,6391,6724,6759,
6990,6775,7019,7086,7396,6504,6771,6872,7023,692
3,7147,7
151,7443,6961,7245,7272,7569,7279,7572,7574,7704
,5993,6240,6390,6725,6423,6758,6772,7020,6511,68
74,6878,
7144,6926,7148,7247,7446,6533,6924,6965,7244,701
6,7274,7275,7573,7084,7393,7395,7575,7441,7636,7
638,787
2,6678,6988,6991,7277,7087,7394,7398,7633,7149,7
442,7444,7637,7570,7639,7708,7874,7242,7568,7571
,7705,76
32,7706,7709,7875,7634,7710,7711,7876,7873,7877,
7878,7879,216,217,218,223,219,344,347,480,220,346
,349,484 ,416,521,523,886,221,348,350,520,419,526,
543,938,422,542,538,1003,787,1027,1059,1518,222,4
17,421,536,423,5
41,555,1005,485,785,789,1028,881,1126,1203,1573,5
22,791,884,1201,937,1212,1307,1606,1002,1309,133
5,1684,1
428,1760,1842,2321,345,418,482,784,486,788,880,11
21,524,885,856,1206,941,1265,1329,1629,540,883,10
01,1308 ,1007,1332,1427,1756,1031,1430,1520,1832,
1572,1946,1994,2521,557,1004,1029,1426,1127,1512
,1527,1847,1210 ,1568,1605,1962,1631,2047,2138,26
48,1311,1627,1687,2087,1758,2139,2225,2749,1839,
2231,2316,2825,2401,288
0,2996,3596,351,481,487,882,527,936,939,1328,552,
1000,1024,1425,1058,1507,1515,1846,786,1025,1120
,1513,12
02,1526,1598,1966,1264,1599,1628,2042,1753,2109,
2181,2729,858,1124,1211,1571,1268,1604,1636,2104
,1424,16
85,1759,2141,1838,2230,2291,2824,1514,1771,1944,
2243,1963,2327,2403,2878,2084,2438,2556,2969,265
6,3032,3
201,3597,862,1213,1331,1639,1506,1757,1835,2241,
1519,1840,1948,2320,1995,2402,2520,2945,1594,196
7,2043,2
432,2140,2552,2650,3048,2175,2662,2808,3140,2836
,3214,3306,3881,1633,2105,2168,2559,2244,2728,28
11,3194,
2400,2821,2879,3266,2974,3309,3489,3981,2487,293
6,2997,3388,3030,3591,3645,4065,3199,3676,3773,4
026,382
3,4198,4385,4896,420,525,537,1006,553,1026,1122,1
525,554,1123,1207,1574,1304,1630,1650,2179,857,1
208,130
5,1653,1333,1752,1769,2180,1429,1768,1843,2295,1
992,2399,2406,2877,860,1330,1431,1655,1522,1792,
1945,239 8,1570,1960,1996,2426,2046,2546,2641,3028,1569,2
044,2107,2545,2174,2651,2731,3141,2246,2813,2837
,3213,28
87,3305,3429,3947,887,1517,1523,1950,1593,2040,2
106,2522,1607,2111,2143,2649,2226,2748,2820,3205
,1841,21
82,2245,2751,2322,2830,2886,3268,2468,2941,3002,
3374,3123,3590,3647,4022,1999,2318,2427,2876,254
4,2968,3
006,3534,2646,3035,3133,3595,3202,3701,3795,4119
,2809,3200,3215,3774,3269,3832,3753,4297,3434,39
44,3982,
4395,3995,4497,4638,4980,940,1575,1595,2173,1793
,2229,2290,2812,1951,2294,2323,2839,2439,2943,29
99,3536,
1997,2433,2527,2944,2558,3007,3125,3599,2663,313
5,3191,3697,3267,3793,3880,4301,2178,2547,2640,3
124,273
0,3186,3237,3754,2838,3238,3307,3842,3435,3819,3
951,4409,2951,3370,3540,3945,3600,3994,4024,4466
,3702,40
37,4036,4602,4298,4711,4767,5219,2317,2657,2816,
3239,2942,3308,3428,3905,3003,3535,3592,3983,366
7,3997,4
027,4479,3126,3641,3755,4023,3796,4064,4299,4720
,3904,4311,4382,4770,4452,4946,4978,5345,3212,37
75,3840,
4300,3950,4306,4414,4793,3980,4411,4474,4972,458
4,5007,5152,5604,3998,4498,4708,5071,4758,5155,5
101,561
0,4862,5249,5269,5764,5351,5878,5981,6260,483,53
9,556,1030,790,1209,1306,1637,859,1310,1334,1652,
1505,17
62,1770,2324,861,1504,1516,1761,1524,2041,2085,2
486,1624,2086,2172,2647,2228,2732,2817,3265,863,
1521,159
2,2045,1626,2169,2183,2726,1638,2240,2292,2822,2
326,2881,2949,3310,1686,2319,2405,2940,2523,2998
,3033,34
86,2553,3029,3136,3640,3139,3696,3792,4387,1125,
1625,1632,2227,1654,2293,2325,2873,1833,2407,246
9,2993,2
555,3039,3134,3538,1949,2483,2601,3031,2725,3138
,3147,3664,2750,3148,3190,3794,3369,3833,3932,44
10,1998,
2724,2734,3189,2829,3236,3264,3816,2883,3368,343
1,3891,3594,3948,3984,4475,2992,3488,3601,3985,3
703,401
1,4161,4585,3839,4192,4320,4721,4383,4775,4948,5
327,1200,1651,1763,2404,1947,2482,2557,3122,1993
,2642,27
27,3149,2810,3198,3203,3797,2110,2735,2828,3204,
2882,3365,3389,3888,2975,3484,3593,3969,3665,399
9,4108,4
476,2224,2872,2948,3430,3034,3541,3539,4008,3127
,3644,3677,4066,3817,4164,4294,4737,3195,3752,38
35,4199,
3889,4349,4384,4818,3935,4408,4460,4973,4601,500
9,5153,5605,2247,2995,3038,3646,3146,3700,3818,4
193,333
5,3838,3924,4364,3929,4386,4450,4931,3371,3925,3
934,4413,4009,4455,4533,5006,4116,4600,4675,5072
,4766,52
22,5252,5621,3485,4025,4070,4477,4295,4603,4710,
5113,4321,4760,4819,5248,4949,5270,5349,5825,446
2,4827,4
974,5275,5063,5353,5426,5969,5114,5573,5609,6064
,5750,6126,6209,6559,1269,1834,1961,2643,2108,27
33,2823,
3304,2142,2831,2937,3367,2994,3433,3598,4109,224
2,2950,3049,3537,3137,3699,3666,4118,3187,3772,3
822,431
0,3906,4358,4389,4863,2526,3132,3188,3698,3334,3
799,3841,4365,3366,3907,3931,4394,3949,4451,4465
,4982,33
72,3946,3996,4464,4111,4532,4639,5073,4240,4757,
4761,5223,4826,5253,5324,5758,2554,3311,3364,389
0,3373,3
928,3968,4454,3487,4010,4067,4496,4165,4636,4759
,5217,3834,4110,4296,4674,4322,4771,4830,5250,44
53,4831,
4975,5276,5070,5352,5425,5968,3930,4348,4412,477
4,4463,4971,5002,5326,4573,5008,5097,5424,5216,5
602,562
0,6071,4709,5115,5229,5608,5268,5631,5755,6132,5
344,5765,5869,6205,5884,6301,6305,6711,2600,3375
,3432,40
71,3798,4160,4241,4756,3843,4307,4359,4792,4415,
4930,4981,5325,3933,4388,4461,4947,4478,5003,510
0,5355,4
637,5154,5096,5471,5251,5611,5731,6108,4117,4467
,4499,5062,4736,5112,5228,5606,4769,5230,5255,57
24,5277,
5751,5860,6204,4970,5271,5348,5759,5427,5879,588
5,6281,5603,6021,6070,6335,6127,6442,6480,6698,4
323,457
2,4768,5231,4897,5254,5274,5754,4979,5350,5354,5
868,5572,5882,6065,6304,4983,5470,5607,6020,5730
,6072,60
73,6443,5824,6133,6147,6481,6261,6602,6634,7040,
5218,5630,5725,6109,5861,6146,6208,6487,5883,628
0,6300,6
603,6382,6635,6864,7132,5980,6334,6383,6699,6486
,6710,6865,7133,6558,6884,6885,7194,7041,7195,73
84,7385,
558,559,942,1205,943,1214,1267,1836,1056,1266,12
71,1964,1634,2083,2137,2818,1057,1270,1596,2082,
1649,217
6,2397,2874,1794,2396,2392,2947,2481,3005,3121,3
670,1204,1635,1755,2288,1795,2395,2435,2971,1965
,2471,24
85,3036,2659,3184,3197,3811,2136,2525,2814,3193,
2827,3270,3385,3892,2946,3387,3533,3992,3602,405
6,4204,4
635,1215,1648,1844,2470,2080,2484,2658,3143,2170
,2815,2602,3206,2885,3329,3491,3923,2394,2661,29

39,3386,
2973,3502,3589,4020,3051,3604,3678,4162,3810,429
2,4318,4825,2437,2970,3037,3588,3185,3648,3789,4
207,323
4,3790,3883,4312,3927,4353,4448,5000,3391,3921,4
017,4357,4038,4449,4523,5077,4195,4529,4606,5141
,4673,51
96,5272,5852,1597,1837,2081,2660,2177,2826,2875,
3490,2424,2938,3000,3543,3120,3643,3651,4206,248
0,3001,3
142,3649,3196,3788,3836,4314,3328,3837,3922,4338
,4019,4391,4519,5059,2604,3150,3235,3809,3330,38
82,3938,
4366,3542,3993,4039,4457,4194,4528,4575,5140,365
0,4063,4242,4535,4313,4645,4723,5194,4354,4764,4
932,523
3,5010,5346,5585,5853,2644,3271,3501,3971,3642,4
021,4167,4531,3671,4196,4302,4634,4319,4722,4824
,5221,38
20,4315,4339,4762,4456,4898,5004,5452,4503,5012,
5084,5468,5158,5600,5680,6105,3937,4367,4472,493
5,4568,5
058,5087,5514,4672,5137,5195,5650,5234,5683,5767
,6175,4817,5202,5273,5736,5302,5831,5863,6283,55
75,5876,
5971,6276,6063,6336,6483,6834,1754,2171,2289,297
2,2425,3004,3144,3787,2434,3145,3207,3812,3332,3
926,397
2,4517,2603,3232,3333,3975,3503,4018,4061,4518,3
603,4060,4205,4605,4316,4647,4726,5193,2606,3500
,3605,39
87,3784,4068,4243,4646,3808,4308,4332,4738,4352,
4860,4951,5300,3791,4350,4381,4859,4502,5005,506
1,5469,4
570,5099,5159,5599,5201,5655,5739,6145,2819,3669
,3785,4304,3815,4336,4380,4828,3893,4393,4459,50
01,4524,
5076,5136,5597,4197,4520,4569,5079,4640,5156,520
0,5652,4772,5205,5296,5734,5455,5830,5871,6264,4
335,463
2,4739,5192,4858,5232,5298,5820,4976,5429,5461,5
851,5586,5937,5983,6311,5085,5584,5601,5976,5653
,6066,59
61,6375,5756,6142,6188,6555,6207,6633,6690,6886,
2884,3813,3821,4501,4069,4527,4574,5098,4305,460
4,4641,5
185,4765,5207,5279,5822,4333,4763,4857,5220,4934
,5299,5457,5855,5013,5463,5513,5881,5651,5979,61
04,6393,
4516,4861,4950,5456,5060,5480,5623,5962,5184,562
8,5681,6098,5757,6061,6159,6557,5227,5728,5828,6
143,585
6,6206,6266,6608,5938,6279,6278,6658,6380,6697,6
717,7043,4607,5011,5102,5629,5206,5682,5738,6113
,5297,58
21,5848,6189,5875,6211,6277,6615,5458,5859,5963,
6265,6016,6282,6381,6704,6112,6433,6454,6728,658
8,6862,6
882,7193,5598,5977,6096,6392,6158,6394,6584,6733
,6174,6565,6610,6870,6654,6901,7014,7282,6228,66
36,6694,
6955,6712,7029,7005,7312,6832,7107,7141,7386,721
1,7434,7479,7612,1845,2393,2436,3050,2524,3233,3
384,393
9,2605,3390,3532,3974,3607,4058,4062,4642,2607,3
606,3668,4057,3786,4337,4355,4816,3894,4356,4500
,4977,45
26,5068,5103,5649,2645,3679,3814,4351,3920,4473,
4521,5056,3970,4530,4586,5138,4644,5197,5225,570
0,4016,4
633,4725,5204,4829,5278,5347,5762,4899,5301,5464
,5858,5467,5880,5978,6485,3151,3895,3936,4525,39
86,4587,
4643,5187,4163,4727,4773,5257,4929,5431,5462,582
6,4303,4795,4945,5303,5015,5466,5473,5872,5078,5
474,551
2,5982,5727,6067,6134,6564,4334,5014,5074,5483,5
143,5622,5648,6022,5199,5726,5749,6111,5850,6156
,6190,66
11,5256,5766,5857,6191,5939,6263,6317,6655,6075,
6332,6434,6705,6455,6731,6866,7179,3192,3973,405
9,4724,4
293,4794,4933,5454,4317,4968,5057,5475,5086,5574
,5587,6017,4392,5075,5142,5596,5198,5705,5737,61
06,5235,
5760,5849,6173,5873,6229,6302,6612,4522,5186,522
4,5748,5428,5829,5827,6230,5459,5862,5877,6284,6
023,631
8,6372,6707,5515,5960,6069,6337,6107,6449,6482,6
734,6141,6556,6600,6871,6657,6903,7015,7283,4571
,5259,54
30,5870,5472,5936,6060,6333,5703,6074,6124,6452,
6129,6484,6586,6861,5729,6125,6140,6567,6231,659
1,6639,6
900,6308,6656,6693,6972,6716,7056,7114,7315,5761
,6267,6286,6613,6373,6659,6696,7007,6435,6714,67
35,7106,
6867,7142,7209,7417,6604,6797,6880,7153,6953,722
5,7238,7477,7012,7251,7303,7502,7362,7546,7583,7
787,333
1,4166,4309,4969,4390,5069,5139,5654,4458,5157,5
203,5707,5258,5753,5854,6303,4534,5226,5453,5823
,5465,58
87,5874,6310,5481,5970,6062,6432,6114,6450,6553,
6833,4856,5460,5482,5886,5702,6019,6097,6453,570
6,6115,6
131,6554,6157,6587,6607,6888,5732,6144,6210,6606
,6307,6638,6691,6973,6338,6709,6715,7057,6796,71
15,7176,
7370,4928,5701,5704,6110,5733,6128,6172,6590,576
3,6262,6285,6632,6319,6688,6713,7031,6068,6306,6
374,669
2,6440,6729,6798,7112,6589,6799,6881,7154,6954,7
224,7237,7476,6130,6448,6566,6730,6605,6869,6890
,7178,66
53,6902,6975,7236,7030,7280,7314,7525,6695,7013,7059,7302,7140,7333,7369,7556,7192,7387,7433,7581,7450,7653,7655,7883,4944,5735,5752,6287,6018,6316,6339,6708,6099,6395,6451,6732,6585,6860,6887,7177,6135,6552,6601,6863,6614,6891,7004,7227,6689,7028,6974,7249,7113,7313,7361,7544,6309,6609,6637,6952,6706,7006,7058,7300,6719,7104,7135,7334,7155,7363,7418,7580,6868,7143,7208,7371,7239,7435,7451,7615,7281,7501,7524,7701,7547,7724,7726,7880,6441,6652,6718,7105,6835,7134,7152,7368,6883,7210,7226,7432,7250,7448,7503,7654,6889,7248,7301,7500,7360,7526,7527,7725,7416,7557,7559,7727,7613,7808,7810,7948,7042,7332,7335,7545,7419,7558,7582,7785,7449,7614,7652,7809,7702,7811,7912,7950,7478,7700,7703,7881,7784,7882,7913,7951,7786,7914,7915,8032,7949,8033,8034,8035,1060,1061,1062,1511,1063,1600,1603,1796,1508,1602,1681,2312,1764,2429,2431,3130,1509,1680,1682,2428,1767,2466,2655,3210,1774,2654,2550,3343,2835,3427,3483,4014,1510,1765,1773,2548,1775,2653,2723,3361,2313,2833,2953,3436,3053,3498,3531,4113,2430,2955,3128,3529,3209,3656,3759,4290,3342,3769,3887,4396,3940,4468,4582,5117,1601,1766,1798,2832,2314,2952,3052,3493,2464,3129,2956,3586,3337,3661,3845,4329,2652,3055,3341,3768,3363,3884,3911,4428,3439,3942,4028,4512,4112,4678,4742,5265,2745,3360,3437,3910,3499,3988,4035,4591,3654,4104,4289,4702,4331,4803,4866,5448,3771,4327,4399,4823,4430,4867,4997,5581,4579,5027,5080,5625,5165,5664,5720,6200,1683,1797,2315,3054,2467,3208,3211,3844,2720,3340,3424,3909,3482,3979,3991,4590,2834,3425,3492,3989,3530,4034,4246,4706,3660,4247,4328,4798,4425,4837,4993,5569,2958,3496,3655,4107,3672,4288,4344,4832,3908,4397,4431,4869,4578,5026,5055,5624,3990,4507,4676,5031,4703,5147,5167,5646,4820,5238,5356,5693,5476,5840,5953,6201,3026,3657,3847,4347,3978,4429,4515,5029,4015,4580,4696,5116,4743,5166,5264,5685,4202,4707,4799,5212,4868,5320,5450,5864,4987,5486,5588,5904,5636,5966,6006,6445,4341,4833,4900,5359,5048,5568,5591,5934,5164,5617,5647,5990,5698,6033,6137,6537,5263,5672,5721,6092,5818,6195,6253,6649,5943,6296,6345,6594,6407,6738,6841,7128,1772,2465,2549,3362,2721,3426,3494,4033,2722,3495,3587,4114,3756,4330,4362,4991,2957,3652,3757,4377,3885,4424,4505,4992,3941,4504,4583,5067,4740,5163,5190,5645,3024,3846,3943,4379,4030,4508,4677,5162,4106,4700,4752,5210,4802,5318,5401,5816,4105,4800,4835,5317,4986,5451,5571,5905,5050,5593,5637,5965,5671,6005,6101,6515,3131,4013,4031,4698,4201,4796,4834,5266,4291,4839,4871,5449,4998,5580,5616,5957,4581,4994,5049,5583,5118,5634,5670,6000,5240,5677,5742,6078,5891,6194,6255,6582,4755,5082,5211,5644,5316,5692,5746,6154,5406,5843,5897,6199,5954,6329,6367,6671,5589,5952,5967,6346,6001,6424,6341,6761,6118,6512,6538,6851,6547,6933,7026,7184,3336,4115,4203,4985,4509,5025,5054,5592,4699,5066,5119,5639,5239,5679,5723,6168,4753,5213,5315,5684,5358,5747,5893,6203,5487,5899,5931,6313,5991,6365,6444,6765,4990,5319,5400,5892,5570,5918,5985,6342,5638,5986,6007,6438,6119,6403,6519,6853,5691,6058,6184,6513,6212,6546,6592,6914,6330,6597,6596,6998,6762,7051,7079,7327,5081,5477,5612,5987,5678,6032,6100,6473,5743,6155,6196,6539,6271,6549,6595,6931,5894,6249,6343,6583,6368,6648,6763,7052,6472,6783,6838,7090,6896,7162,7182,7405,5964,6347,6436,6764,6518,6778,6858,7097,6536,6855,6918,7172,6992,7199,7288,7496,6550,6934,7048,7223,7070,7291,7261,7506,7126,7349,7365,7592,7411,7646,7677,7780,1799,2551,2744,3438,2954,3653,3758,4345,2959,3770,3886,4376,3977,4470,4506,5144,3025,3976,4012,4469,4032,4797,4821,5262,4324,4822,4984,5407,5024,5576,5613,5989,3027,4029,4200,4801,4326,4901,4995,5518,4346,5028,5064,5618,5146,5665,5689,6034,4398,5083,5189,5676,5267,5722,5841,6122,5321,5817,5900,6248,5903,6312,6364,6843,3497,4325,4340,4999,4378,5065,5145,5641,4513,5191,5241,5709,5323,5847,5898,6170,4697,5247,5393,5819,5517,5902,5911,6268,5582,5912,5930,6366,6057,6425,6496,6854,4754,5516,5578,5929,5633,5984,5988,6400,5667,6056,6103,6459,6198,6516,6540,6919,5708,6136,6213,6541,6331,6563,6681,6993,6431,6700,6792,7053,6839,7095,7164,7403,3528,4363,4471,5188,4679,5246,5357,5890,4741,5402,5519,5913,5590,5942,5955,6369,4838,557 9,5632,5956,5666,6045,6093,6456,5699,6120,6197,6521,6269,6551,6664,6928,4996,5640,5688,6102,5842,6185,6171,6560,5895,6252,6297,6650,6401,6684,6750,7065,5935,6340,6427,6739,6457,6809,6840,7102,6499,6852,6908,7173,6997,7201,7289,7497,5051,5711,5846,6254,5910,6328,6402,6701,6043,6430,6488,6820,6493,6842,6894,7139,6059,6489,6498,6857,6561,6899,6969,7198,6668,6996,7047,7228,7078,7330,7352,7509,6121,6593,6662,6929,6751,6999,7050,7265,6793,7072,7103,7348,7165,7366,7409,7601,6910,7111,7174,7375,7219,7413,7422,7669,7266,7481,7505,7692,7566,7738,7773,7887,3673,4514,4701,5403,4836,5577,5619,6004,4870,5635,5673,6047,5710,6117,6202,6665,5030,5690,5865,6169,5901,6315,6270,6670,5919,6344,6406,6782,6474,6818,6845,7127,5314,5896,5928,6314,6042,6371,6437,6821,6046,6475,6495,6850,6517,6895,6913,7186,6076,6514,6548,6912,6667,6968,7027,7229,6744,7069,7073,7331,7110,7353,7400,7586,5322,6035,6044,6458,6077,6492,6520,6898,6123,6562,6651,6932,6685,7024,7071,7325,6426,6666,6760,7046,6794,7091,7118,7350,6897,7119,7175,7376,7222,7412,7421,7668,6494,6808,6856,7094,6911,7171,7190,7402,6981,7200,7257,7420,7324,7494,7508,7699,7049,7267,7341,7504,7364,7515,7579,7744,7404,7593,7629,7769,7656,7805,7813,7959,5392,6079,6116,6663,6370,6680,6745,7068,6439,6779,6819,7096,6859,7138,7185,7401,6497,6844,6909,7163,6930,7191,7260,7415,7025,7290,7256,7463,7351,7507,7551,7728,6669,6915,6935,7218,7064,7264,7340,7498,7089,7342,7355,7540,7377,7567,7624,7768,7170,7367,7408,7587,7423,7647,7657,7797,7495,7685,7698,7827,7739,7850,7860,7946,6795,6980,7088,7343,7129,7354,7374,7578,7183,7410,7414,7628,7480,7650,7693,7812,7187,7462,7499,7684,7550,7712,7713,7851,7600,7745,7755,7861,7781,7902,7922,8036,7326,7514,7541,7729,7625,7754,7772,7867,7651,7796,7804,7903,7838,7923,7988,8052,7676,7826,7839,7947,7866,7958,7989,8053,7886,8000,8001,8070,8037,8071,8112,8113,2746,2747,3338,3585,3339,3658,3663,4576,3480,3662,3675,4704,4342,4807,4865,5614,3481,3674,4244,4806,4361,4988,5161,5642,4510,5160,5148,5687,5245,5745,5889,6274,3584,4343,4427,5052,4511,5151,5215,5695,4705,5243,5261,5844,5479,5916,5941,6379,4864,5313,5594,5933,5627,6002,6089,6460,5686,6091,6153,6544,6214,6616,6740,7011,3659,4360,4588,5242,4804,5260,5478,5907,4902,5595,5394,5958,5669,6037,6139,6479,5150,5485,5675,6090,5697,6150,6193,6580,5867,6224,6298,6682,6378,6748,6790,7109,5237,5694,5845,6192,5917,6256,6361,6743,5974,6362,6447,6784,6491,6813,6892,7188,6095,6477,6577,6817,6598,6893,6947,7233,6703,6957,7002,7285,7045,7308,7372,7616,4245,4577,4805,5484,4989,5626,5643,6138,5208,5674,5740,6187,5888,6251,6259,6742,5244,5741,5906,6257,5940,6360,6428,6786,6036,6429,6478,6806,6579,6847,6943,7215,5396,5914,5975,6377,6038,6446,6502,6822,6186,6545,6599,6905,6702,6956,6983,7284,6258,6623,6746,6971,6785,7037,7055,7306,6814,7076,7156,7345,7202,7406,7485,7617,5404,6003,6149,6523,6250,6581,6687,6959,6275,6736,6766,7010,6791,7054,7108,7329,6404,6787,6807,7074,6904,7130,7196,7428,6939,7204,7252,7460,7294,7492,7528,7721,6501,6823,6916,7159,6976,7214,7255,7474,7044,7269,7307,7518,7346,7531,7595,7763,7101,7318,7373,7560,7390,7607,7627,7799,7483,7644,7671,7792,7691,7828,7863,7982,4426,4903,5053,5696,5209,5744,5908,6351,5214,5909,5959,6396,6040,6490,6524,6941,5395,5972,6041,6527,6151,6578,6621,6942,6215,6620,6741,7001,6788,7039,7062,7305,5398,6148,6225,6543,6348,6660,6747,7038,6376,6780,6800,7066,6812,7124,7167,7388,6363,6810,6837,7123,6938,7197,7217,7461,6978,7259,7295,7491,7317,7523,7563,7753,5615,6273,6349,6776,6399,6804,6836,7116,6461,6849,6907,7189,6948,7232,7268,7489,6737,6944,6977,7235,7032,7292,7316,7520,7092,7321,7380,7554,7431,7606,7631,7788,6803,7008,7067,7304,7122,7344,7382,7596,7180,7425,7453,7611,7486,7661,7679,7819,7253,7484,7493,7672,7521,7694,7665,7835,7584,7750,7764,7871,7771,7921,7938,8002,5668,6397,6405,6937,6661,6951,6982,7258,6777,7000,7033,7297,7077,7323,7379,7598,6801,7075,7121,7328,7158,7383,7437,7619,7205,7455,7473,7649,7519,7675,7720,7841,6940,7125,7166,7436,7216,7468,7511,7666,7296,7512,7529,7718,7585,7689,7759,7885,7339,7548,7604,7751,7620,7770,7790,7908,7662,77

95,7794,7934,7836,7945,7965,8039,7003,7203,7262,7513,7322,7530,7562,7733,7381,7597,7608,7765,7643,7775,7793,7919,7438,7623,7667,7789,7680,7798,7837,7952,7732,7845,7858,7968,7896,7986,7998,8069,7490,7673,7716,7840,7758,7842,7892,7973,7762,7889,7910,7994,7930,8009,8026,8090,7776,7924,7942,8015,7960,8029,8021,8096,7980,8047,8057,8114,8075,8122,8131,8152,4589,5149,5236,5866,5312,5973,6088,6503,5397,6094,6152,6526,6227,6618,6622,7034,5399,6226,6272,6617,6350,6805,6815,7100,6462,6816,6936,7181,6950,7220,7263,7517,5405,6299,6398,6811,6476,6917,6945,7212,6522,6958,6994,7270,7036,7309,7337,7532,6576,7009,7061,7320,7117,7378,7407,7590,7131,7389,7456,7622,7459,7648,7674,7865,5915,6463,6500,6949,6542,6995,7035,7299,6683,7063,7093,7357,7137,7427,7454,7602,6767,7099,7161,7391,7207,7458,7465,7640,7234,7466,7472,7678,7543,7695,7746,7888,6802,7206,7230,7471,7287,7510,7516,7686,7311,7542,7565,7731,7610,7756,7766,7911,7356,7594,7621,7767,7663,7783,7821,7931,7715,7824,7846,7953,7859,7971,7990,8067,5932,6525,6619,7060,6749,7098,7157,7430,6789,7168,7213,7467,7254,7482,7487,7681,6848,7231,7286,7488,7310,7537,7561,7722,7347,7588,7609,7761,7641,7777,7806,7916,6946,7298,7336,7564,7424,7605,7603,7778,7439,7626,7645,7800,7687,7822,7832,7955,7475,7664,7697,7829,7723,7853,7862,7974,7749,7884,7900,7995,7933,8011,8027,8091,6979,7359,7426,7630,7464,7660,7688,7825,7535,7714,7736,7856,7741,7864,7894,7985,7549,7737,7748,7891,7779,7899,7927,8008,7816,7932,7941,8016,7964,8040,8050,8099,7589,7791,7802,7917,7833,7935,7944,8023,7847,7962,7975,8046,7991,8058,8073,8117,7904,7977,7996,8061,8013,8077,8082,8129,8024,8087,8095,8134,8106,8142,8151,8171,6039,6686,6781,7169,6846,7221,7271,7522,6906,7293,7319,7539,7358,7577,7618,7807,6970,7338,7429,7599,7457,7659,7642,7818,7469,7670,7690,7844,7734,7854,7869,7981,7120,7452,7470,7658,7534,7683,7717,7857,7538,7735,7743,7870,7757,7895,7907,8004,7552,7752,7774,7906,7815,7926,7939,8017,7830,7957,7963,8041,7976,8051,8064,8110,7136,7533,7536,7730,7553,7740,7760,7898,7591,7782,7801,7920,7823,7936,7961,8031,7696,7814,7834,7940,7848,7969,7978,8048,7897,7979,7997,8062,8014,8076,8081,8128,7742,7852,7890,7970,7905,7993,8006,8066,7929,8010,8019,8080,8030,8088,8098,8137,7943,8025,8043,8094,8056,8101,8109,8144,8068,8115,8121,8149,8126,8157,8159,8179,7160,7555,7576,7803,7682,7820,7831,7956,7719,7843,7855,7972,7893,7984,8003,8065,7747,7868,7901,7987,7918,8007,8020,8079,7937,8028,8018,8085,8049,8097,8105,8140,7817,7909,7925,8012,7954,8022,8042,8092,7967,8044,8055,8102,8063,8107,8118,8148,7992,8059,8072,8111,8083,8123,8127,8155,8089,8133,8136,8161,8143,8164,8166,8176,7849,7928,7966,8045,7983,8054,8060,8108,7999,8074,8078,8120,8086,8124,8135,8158,8005,8084,8093,8132,8104,8138,8139,8165,8116,8145,8147,8167,8153,8172,8174,8184,8038,8100,8103,8141,8119,8146,8150,8169,8125,8154,8156,8173,8162,8175,8180,8186,8130,8160,8163,8177,8168,8178,8181,8187,8170,8182,8183,8188,8185,8189,8190,8191]

**Sequence group 1: Q1_16384**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,1024,1025,67,41,144,28,69,42,516,49,74,272,160,520,288,528,192,544,70,44,131,81,50,73,15,320,133,52,23,134,384,76,1026,1028,137,82,56,27,97,39,259,84,138,145,261,29,43,98,515,88,1032,1040,140,30,2048,2049,2050,2052,146,71,262,265,161,576,45,100,640,51,148,46,1056,1027,75,266,273,517,104,162,53,193,1029,1088,152,77,1033,1030,164,768,1041,1034,268,274,518,54,83,57,521,112,135,78,289,194,85,276,522,58,168,139,99,86,60,280,89,290,529,524,196,141,2056,2064,2080,2051,101,147,176,142,530,321,31,200,90,545,292,322,532,263,149,102,105,304,296,163,92,47,267,385,546,324,208,386,1042,1152,150,153,2053,2112,2057,2054,165,106,55,328,4096,4097,4098,4100,4104,4112,4128,4099,536,577,548,113,154 ,79,269,108,578,224,1036,1057,166,519,552,195,1089,1044,270,641,523,275,580,291,2065,2058,2066,2176,59,169 ,560,114,277,156,1280,1058,87,197,116,170,61,531,525,642,2060,2081,2113,2068,281,278,526,177,2304,2082,207 2,2084,293,388,1048,1060,2055,2177,2114,2560,91,584,769,198,1031,1153,172,120,201,336,62,282,1090,1536,143,103,178,294,93,644,202,592,323,392,297,770,107,180,1035,1064,151,209,284,648,94,204,298,400,608,352,325,533,155,210,305,547,300,109,1092,1154,1043,1037,184,534,537,115,4101,4160,4105,4102,4113,4106,4114,4224,167,225,326,306,772,157,656,329,1072,1038,110,117,212,171,776,330,226,549,1096,1281,538,387,308,216,1045,1156,416,271,279,158,337,550,672,118,332,579,540,389,173,121,553,199,784,179,228,338,312,704,1059,1282,390,174,554,581,393,283,2059,2088,2116,2178,122,448,353,561,4108,4129,4161,4116,4352,4130,4120,4132,203,63,340,394,527,582,556,181,8192,8193,8194,8196,8200,8208,8224,8195,8197,8256,8201,8198,8209,8202,8210,8320,1050 ,1537,1104,1061,1049,1046,295,285,232,124,205,182,643,562,286,585,1160,1284,299,354,2067,2061,2096,2062,211,401,1288,1062,1538,1120,185,396,2120,2305,2069,2180,344,586,1091,1065,1168,1052,645,593,1093,1066,535,240,4103,4225,4162,4608,4107,4136,4164,4226,206,95,327,564,1540,1073,800,402,356,307,301,417,2083,2306,2074,2561,213,568,832,588,186,646,404,227,896,594,1098,1296,1184,1544,1312,1552,4115,4109,4144,4110,4168,4353,4117,4228,418,302,649,771,1216,1568,360,539,4131,4354,4122,4609,4176,4133,4121,4118,111,331,214,309,2128,2085,2073,2070,4232,4356,4360,4134,4610,4192,5120,5121,188,449,1094,1068,1155,1105,217,408,2184,2308,2312,2086,609,596,551,650,229,159,420,310,541,773,610,657,2562,2144,3072,3073,333,119,600,339,218,368,652,230,391,313,1074,1097,450,542,1039,1344,334,233,555,774,175,123,1157,1076,658,612,341,777,2115,2089,2192,2076,220,314,424,395,673,583,1047,1158,355,287,183,234,125,557,660,616,1408,1100,342,316,241,778,1161,1106,563,345,452,397,403,207,1080,1051,674,558,785,432,2117,2090,2564,2097,2122,2320,2208,2568,357,187,1121,1063,1283,1108,236,664,8204,8225,8257,8212,8448,8226,8216,8228,8199,8321,8258,8704,8203,8232,8260,8322,624,587,780,705,126,242,565,398,1162,1169,346,456,1285,1053,358,405,2336,2576,2240,2592,303,569,244,595,189,566,676,361,1067,1122,706,589,215,786,1539,1112,2118,2092,2179,2129,1164,1054,647,348,419,406,464,680,2098,2121,2063,2368,801,362,590,409,570,788,597,572,219,311,1170,1095,1286,1289,708,598,601,651,1185,1600,1069,1124,421,792,802,611,602,410,1664,1075,231,688,1172,1070,653,248,369,190,364,654,659,335,1099,1290,2181,2100,2071,2182,480,315,221,370,1297,1541,1128,1186,613,422,425,451,4163,4137,4240,4124,4165,4138,4612,4145,614,543,235,412,343,372,1077,1217,8211,8205,8240,8206,8264,8449,8213,8324,8227,8450,8218,8705,8272,8229,8217,8214,775,317,222,426,453,237,559,833,1176,1101,1188,1792,1292,1298,804,712,2432,2124,3074,3076,2185,2130,2104,2075,2145,2087,2307,2132,834,661,808,779,617,604,433,720,816,836,347,897,1542,1078,1107,1081,243,662,1545,1136,2186,2193,2309,2077,454,318,675,618,4170,4368,4256,4616,4384,4624,4288,4640,898,781,376,428,2091,2146,2563,2136,3080,3088,2188,2078,665,736,567,840,4166,4140,4227,4177,4146,4169,4111,4416,625,238,1159,1102,2194,2119,2310,2313,2209,2624,2093,2148,1313,1218,1109,1300,2688,2099,2196,2094,1546,1082,359,457,8328,8452,8456,8230,8706,8288,9216,9217,8259,8233,8336,8220,8261,8234,8708,8241,399,787,591,678,434,677,1192,1163,3104,3075,2123,2314,1123,1110,349,245,458,666,620,363,127,191,782,407,4229,4148,4119,4230,4480,4172,5122,5124,436,626,1084,1304,1113,1314,1553,1548,571,465,1220,1165,681,246,707,350,1125,1171,1200,1166,2321,2565,2152,2210,2101,2241,3077,3136,2200,2125,3081,3078,8266,8464,8352,8712,8480,8720,8384,8736,8262,8236,8323,8273,8242,8265,8207,8512,599,668,790,460,1554,1345,1055,1224,2212,2816,3089 ,3082,249,682,1114,1569,8325,8244,8215,8326,8576,8268,9218,9220,8329,8274,8248,8219,8289,8231,8451,8276,573,411,803,789,709,365,440,628,4233,4178,4152,4123,4193,4135,4355,4180,8330,8337,8453,8221,8235,8290,8707,8280,9224,9232,8332,8222,10240,10241,10242,10244,689,374,423,466,2316,2322,2566,2102,2131,2105,2569,2160,793,250,371,481,4234,4241,4357,4125,4139,4194,4611,4184,1316,1346,1556,1287,1173,1126,1129,1328,574,413,603,366,468,655,900,805,1320,1187,1116,1071,1291,1409,1570,1348,5128,5136,4236,4126,6144,6145,6146,6148,615,684,710,429,1232,1410,794,252,373,605,848,690,1174,1177,713,632,482,806,427,904,2183,2126,
2337,22
42,414,223,1189,1130,2133,2324,2570,2106,663,692,
835,619,1079,1352,1560,1601,472,455,796,809,2216,
2187,21
47,2134,1572,1137,1178,1103,714,721,1293,1132,42
42,4167,4358,4361,4257,4672,4141,4196,837,716,86
4,810,60
6,912,722,696,1602,1248,1190,1543,2108,2328,2137,
2338,377,435,817,319,621,812,484,430,838,667,1576
,1219,1
294,1665,1547,1299,2577,2572,2244,2189,488,239,3
78,459,622,627,1604,1315,2149,2195,2224,2190,108
3,1193,4
37,380,818,461,496,669,679,724,841,629,2578,2369,
2079,2248,1584,1138,1301,1180,1111,1221,351,467,
4736,414
7,4244,4142,5152,5123,4171,4362,4369,4613,4200,4
258,4149,4289,5125,5184,438,737,251,462,2138,259
3,2340,2
370,2580,2311,2197,2150,442,441,1140,1194,1085,1
555,1549,1666,1305,1302,1550,1201,469,247,683,84
2,1317,1
412,738,899,2153,2352,2344,2211,670,783,849,820,2
140,2095,2315,2433,728,928,791,367,4248,4173,512
9,5126,4
260,4864,5137,5130,901,630,1115,1608,685,844,179
3,1222,633,711,1196,1144,1225,1360,253,691,2594,2
372,225
6,2434,1086,1306,1167,1127,824,902,1202,1318,309
0,3200,2198,2201,4364,4370,4614,4150,4179,4153,4
617,4208 ,2213,2154,2103,2376,1117,1668,686,740,8
50,375,444,470,483,415,1226,1616,4231,4174,4385,4
290,4181,4372,46
18,4154,1347,1416,485,905,1321,1794,795,473,1131,
1204,1175,1233,1308,1672,1118,1228,634,744,852,9
60,2584,
2625,2596,2161,2202,2127,2317,2156,1322,1424,163
2,1376,1349,1557,1179,1234,2626,2272,3084,3105,2
214,256
7,2600,2243,865,693,1329,1571,1324,1133,1208,155
8,1561,1139,797,906,3137,3092,2318,2689,715,807,1
191,124
9,2571,2323,2628,2339,1350,1330,474,636,694,254,7
17,575,913,798,1796,1181,1680,1353,811,379,2107,2
217,260
8,2162,4264,4235,4195,4182,4156,4376,4185,4386,6
97,431,607,489,866,723,486,908,2325,2204,3328,310
6,2135,2
245,2164,2218,1134,1141,718,813,476,856,839,725,8
338,8263,8454,8457,8353,8768,8237,8292,8832,8243
,8340,8
238,9248,9219,8267,8458,1236,1195,1800,1354,698,
914,752,868,819,814,439,929,2109,2579,2573,2690,1
250,157
3,490,623,671,739,916,463,843,381,497,930,1562,14
11,1332,1240,2329,2326,2574,2225,2341,2436,3096,
3108,213
9,2632,2817,2246,1440,1295,1303,1182,4625,4620,4
292,4237,6152,6160,6176,6147,4197,4243,4272,4238
,4626,44
17,4127,4296,4186,4641,4388,4418,4628,4359,4245,
4198,1361,1574,1696,1142,1356,1603,1564,1413,119
7,1145,1
577,1223,821,726,1808,1203,1252,1362,1336,1728,9
61,872,1414,1198,3079,3201,2220,2168,2249,2384,2
110,2330 ,492,631,1578,1605,3138,3584,2191,2151,4
201,4400,4392,4259,4188,4143,4363,4481,729,700,4
43,741,1417,1307,
1146,1472,8465,8709,8296,8354,8245,8385,9221,928
0,8344,8269,9225,9222,8356,8960,9233,9226,1377,1
585,122
7,1087,845,920,382,822,4642,4420,4304,4482,5138,5
248,4246,4249,6149,6208,6153,6150,4261,4202,4151
,4424,1
364,1418,1551,1606,1580,1205,1319,1309,8460,8466
,8710,8246,8275,8249,8713,8304,8327,8270,8481,83
86,8277,
8468,8714,8250,1256,1148,851,730,2226,2342,2141,
2692,4632,4673,4644,4209,4250,4175,4365,4204,467
4,4320,5
132,5153,4262,4615,4648,4291,2250,2640,2371,2440
,2345,2818,2155,2228,5185,5140,4366,4737,4619,43
71,4676,
4387,3083,3112,2199,2257,498,880,742,445,471,635,
1229,1206,1667,1586,1310,1609,932,687,1323,1378,
2332,26
96,2142,2252,6161,6154,6162,6272,4155,4265,4656,
4210,2346,2448,2656,2400,903,825,500,846,745,826,
1235,14
25,1209,1420,732,446,962,936,475,853,1368,1610,86
7,637,8360,8331,8291,8278,8252,8472,8281,8482,87
21,8716,
8388,8333,10248,10256,10272,10243,907,487,1669,1
617,2373,2581,2203,2258,2353,2595,2348,2157,3140
,3202,3
091,3085,1559,1264,695,746,2232,2582,2585,2163,1
230,1119,828,753,1351,1588,854,857,2215,2273,237
4,2354,2
820,2205,2704,2377,4373,4252,5376,5154,4183,4293
,4212,4266,4157,4627,4621,4738,6156,6177,6209,61
64,4377,
4374,4622,4273,6400,6178,6168,6180,1824,1426,138
0,1331,1325,1441,504,799,3120,3086,2158,2165,226
0,2219,2
824,2378,4389,4484,5144,5156,6151,6273,6210,6656
,255,964,1237,1592,2274,2597,3144,3329,1856,1612,
909,719 ,1210,1670,1428,1251,1920,1618,477,915,63
8,748,1442,1326,8293,8339,8368,8334,8722,8513,82
23,8392,8282,87
37,8484,8514,8724,8455,8341,8294,1673,1795,944,8
69,491,699,754,858,4187,4680,4865,4294,5127,5249,
4268,42
16,4297,4432,4158,4378,5186,5632,4239,4199,1384,
1563,478,968,383,910,815,976,8297,8496,8488,8355,
8284,82 39,8459,8577,8738,8516,8400,8578,9234,9344,8342,8345,2586,2435,2356,2264,3093,3204,2464,2319,2327,2206,2 385,2598,2720,2166,2380,2627,1135,1355,870,917,1238,1333,727,493,873,701,1212,1473,1241,1432,1633,1620,2 588,2437,2221,2169,2601,2247,2832,2227,2276,2386,2360,2752,3107,3330,2438,2222,10245,10304,10249,10246, 8357,8298,8247,8520,12288,12289,12290,12292,12296,12304,12320,12291,1575,1674,1253,1183,1444,1334,931,7 56,2602,2629,2441,2331,1565,1797,860,499,731,823,1634,1681,1357,1143,1624,1363,2170,2496,2401,2609,1242,

1392,1676,1254,922,874,1415,1337,918,502,1474,1566,4274,4390,4189,4740,4298,4688,4419,4488,933,743,760,8 81,2251,2111,2388,2442,4393,4866,4203,4276,5131,5160,4247,4305,1358,1257,1579,1798,1199,1147,1682,1636,2 575,2630,2604,2229,3098,3585,3152,3109,494,702,921,501,1365,1801,1244,1338,4380,4744,4190,4300,4394,4496 ,4704,4448,3097,3094,2343,2333,2280,2172,2253,2230,1448,1419,1697,1607,2691,2610,2334,2633,8728,8769,874 0,8305,8346,8271,8461,8300,8770,8416,9228,9249,8358,8711,8744,8387,1379,1311,1207,1258,1149,1581,1684,16 40,1366,1340,1265,1802,1587,1369,1476,1421,3208,3332,2347,2402,2259,2449,3336,3110,4421,4629,4251,4306,4 401,4643,4396,4205,876,847,992,447,1427,1231,733,827,1698,1582,1809,1456,934,882,937,963,1381,1211,1260,1 688,3586,3168,2233,2444,2392,2634,3139,3113,3216,3100,2693,2641,5188,5250,5139,5133,4280,4630,4633,4211, 747,505,855,924,734,829,965,938,1648,1611,1804,1729,3141,3114,2583,2288,4263,4321,4422,4402,4868,4253,47 52,4425,2254,2143,2375,2612,884,506,749,945,1150,1266,966,755,859,940,1589,1422,1370,1480,1382,1429,1327, 1593,1268,1619,5168,5134,4206,4213,4308,4267,4872,4426,3588,3121,2848,2450,2404,2355,2349,2465,2261,261 6,2880,2636,830,911,871,639,9281,9236,8462,8833,8715,8467,8772,8483,10257,10250,10258,10368,8251,8361,87 52,8306,8469,8348,9472,9250,8279,8389,8308,8362,8253,8723,8717,8834,10252,10273,10305,10260,888,479,121 3,1590,946,750,969,508,4322,4645,5192,5377,4634,4483,4404,4312,5141,5252,4512,4367,4375,4254,4433,4646,8 61,757,970,919,2234,2694,2452,2275,2944,2642,3146,3344,3232,3592,3360,3600,2466,2350,2697,2819,3264,3616 ,2408,2587,875,862,758,948,1700,1385,1730,1613,2159,2379,2262,2357,1239,1810,1671,1372,4768,4214,4428,46 75,4636,4485,4269,4217,1443,1430,1488,1704,1825,1386,1614,1433,4649,4295,4880,4275,4324,4434,4408,4800,1 594,1812,1621,1596,1243,1335,977,923,8473,8470,8718,8369,10496,10274,10264,10276,8485,8580,9240,9252,10 247,10369,10306,10752,1732,1622,1625,1675,2236,2497,3142,3116,1445,1816,1826,1635,3203,3153,2265,2456,1 626,1434,1255,1712,2657,2644,2599,2698,2277,2207,2468,2358,972,761,1677,1272,5155,5378,4486,4270,4650,46 77,4489,4379,2589,2821,2658,2705,2381,2167,2648,2387,1393,1214,1388,1678,2266,2416,2700,2278,6155,6184,6 212,6274,4218,4544,4449,4657,8283,8776,8961,8390,9223,9345,8364,8312,8393,8528,8254,8474,9282,9728,8335, 8295,4299,4159,4436,4490,4623,4678,4652,4277,2439,2361,3122,3145,1683,1359,1504,1339,1245,1394,877,952,4 95,703,935,978,883,762,503,925,2498,2590,3087,3392,8370,8486,8285,8836,8394,8784,8515,8584,8489,8962,829 9,8372,9227,9256,8343,8401,2382,2281,2603,2822,878,735,1637,1446,2223,2171,3205,3124,1449,1475,993,885,2 706,2660,2389,2825,2268,2362,2472,2443,2721,2631,3095,3206,2403,2335,2231,2282,1638,1567,1259,1436,1367, 1396,1799,1341,5146,5633,5200,5157,5145,5142,4391,4381,4328,4220,4301,4278,4739,4658,4382,4681,2173,260 5,2708,2664,3456,3148,2390,2364,2289,2826,3209,3154,2611,2393,2500,2445,5256,5380,4395,4450,6163,6157,61 92,6158,4307,4497,5384,5158,5634,5216,4281,4492,1246,1450,1477,1261,2451,2255,3128,3099,2722,2606,2833,2 480,2405,2235,3169,3111,3331,3156,2284,2712,1583,1857,1828,1736,6216,6401,6165,6276,4440,4682,5187,5161, 1858,1685,1832,1803,2672,2635,2828,2753,5264,5148,4741,4689,5189,5162,4631,4336,2174,2290,2613,2446,939, 994,1641,1628,1457,1744,980,926,1840,1860,1371,1921,1267,1686,1478,1342,3210,3217,2394,2504,3333,3101,24 06,2453,1699,1642,764,941,4302,4191,4423,4660,5636,5169,4896,4498,8476,8840,8286,8396,8490,8592,8800,854 4,8517,8725,8347,8402,8497,8739,8492,8301,1922,1805,967,886,1400,1452,831,947,1689,1760,1591,1864,507,88 9,1649,1262,4452,4403,4397,4513,6179,6402,6170,6

657,4309,4664,4928,4684,4282,4742,4500,4323,2351
,2617,22
92,2643,1383,1481,1423,1811,984,751,1615,1702,14
58,1701,1373,1269,2237,2614,2724,2409,3115,3170,
2754,263
7,1482,1690,1644,1387,1151,1215,1806,1431,1460,1
650,1595,1489,942,996,1705,1270,4992,4690,5194,5
392,5280 ,5640,5408,5648,2263,2834,3587,3160,971,
890,1731,1374,1623,1692,1814,1484,1273,1706,509,
949,1597,1435,97
3,1000,892,950,1827,1813,3212,3102,2695,2396,246
7,2454,2512,2728,4514,4398,4745,4867,5312,5664,4
456,4635 ,4207,4427,4310,4405,6224,6181,6169,616
6,4284,4545,5190,5164,5251,5201,4313,4504,2849,2
410,2638,2457,261
8,2836,2645,2620,9284,9346,9235,9229,8376,8726,8
729,8307,12293,12352,12297,12294,12305,12298,12
306,1241
6,8359,8417,8518,8498,8964,8349,8848,8521,9264,9
230,8302,8309,8404,8363,8968,8522,8418,8741,9288
,9473,87
30,8579,8500,8408,9237,9348,8608,8463,8471,8350,
8529,8742,2267,2359,3218,3143,3334,3337,2756,264
6,2649,2
699,3233,3648,3117,3172,2469,2840,2850,2659,2650
,2458,3712,3123,2279,2736,1733,1389,1464,1652,32
20,3118,
2701,2296,2417,2238,2412,2702,2707,2383,3147,333
8,1713,1398,1447,1490,2528,2363,2269,2418,6280,6
404,640
8,6182,4705,4692,4647,4746,4325,4255,4516,4406,4
637,4869,4706,4753,863,759,1817,1274,3345,3589,3
176,3234 ,6658,6240,7168,7169,4429,4215,4696,443
5,8864,8310,8524,8771,8732,8581,8365,8313,8745,8
391,8976,8371,842
0,8530,8504,8896,1395,1505,1598,1437,1008,510,16
27,1390,2661,2470,2473,2499,2662,2591,2283,2460,
2391,242
0,3125,3265,2823,2365,2270,2474,1492,1679,1924,1
829,979,953,1639,1708,9251,9474,8582,8366,8746,8
773,8585 ,8475,10251,10280,10308,10370,8314,8640
,8545,8753,12300,12321,12353,12308,12544,12322,1
2312,12324,8395,
8255,8532,8586,8719,8774,8748,8373,2501,2285,260
7,2881,3224,3149,3236,3840,3340,3346,2852,2760,2
882,270
9,2856,2827,2665,2652,2481,2768,1734,1453,1818,1
276,4314,4464,4748,4326,4487,4409,5170,5193,9242
,9729,92
96,9253,9241,9238,8487,8477,8424,8316,8397,8374,
8835,8754,8478,8777,9352,9476,8491,8546,10259,10
253,102
88,10254,8403,8593,9480,9254,9730,9312,8377,8588
,4546,4638,5135,5440,4430,4329,4651,4870,4271,42
19,5253,
5172,4754,4708,4437,4873,10312,10497,10261,1037
2,8536,8778,9283,9257,9360,9244,8837,8785,9285,9
258,8727 ,8432,6211,6185,6288,6172,4316,4410,452
0,4491,763,974,1397,1629,1872,1714,954,879,981,98
2,1737,1656,2864,
2884,2395,2945,3590,3126,3155,3129,2291,2710,359
3,3184,1506,1830,1451,1928,2502,2366,2723,2666,4
769,467
9,5143,5254,4451,4383,4279,4330,12295,12417,1235
4,12800,12299,12328,12356,12418,8398,8287,8519,8
756,973
2,9265,8992,8594,4221,4653,4756,4712,5504,5196,4
438,4412,1438,1247,1687,1716,927,995,1859,1643,1
496,1479 ,1820,1833,2946,2829,2424,2476,2713,278
4,2615,2888,1738,1745,765,956,1861,1740,1888,183
4,887,985,1630,19
36,2673,2286,3207,3150,1746,1720,1401,1459,1841,
1343,997,986,3361,3266,3157,3348,4337,4874,5257,
5202,465
9,4441,4548,4493,4499,4303,5176,5147,4770,4654,4
881,4528,6213,6186,6660,6193,6218,6416,6304,6664
,3594,31
30,2407,2505,1645,1836,1508,1454,4453,4283,5217,
5159,5379,5204,4332,4760,2447,2835,2639,2726,186
2,1691,1
512,1263,2482,2725,3240,3211,1402,1483,1646,1651
,4720,4683,4876,4801,4222,4338,4661,4494,5258,52
65,4442,
4552,5381,5149,4454,4501,8548,8499,8493,8609,102
75,10498,10266,10753,8405,8760,9024,8780,8378,88
38,8596 ,8419,9088,8786,9290,9488,9376,9736,9504,
9744,12307,12301,12336,12302,12360,12545,12309,
12420,8610,8494 ,8841,8963,9408,9760,8552,8731,1
2323,12546,12314,12801,12368,12325,12313,12310,
3171,3158,2397,2293,2506 ,2714,2668,2411,2175,22
39,2830,2455,943,891,1461,1404,6432,6672,6336,66
88,4399,4665,4340,4691,4285,4662,
4772,4457,5163,5218,4802,4685,8303,8523,8406,850
1,10320,10277,10265,10262,12424,12548,12552,123
26,1280
2,12384,13312,13313,998,766,1842,1485,2484,2674,
3132,3352,4311,4882,5635,5208,6214,6188,6275,622
5,3161,3
362,3601,3596,1520,1693,1703,1748,2619,2513,3268
,3213,2729,2294,2755,2398,3173,3219,3248,3214,51
1,988,18
65,1653,1375,1491,1462,1761,2647,2716,2838,2508,
3602,3393,3103,3272,1275,1486,1466,1465,1001,951
,1493,12
71,1707,1866,1762,1923,8380,8641,9286,9260,9347,
9297,8409,8600,10376,10500,10504,10278,8801,878
8,8743,8
842,8421,8351,8612,8502,8733,8965,8802,8849,1075
4,10336,11264,11265,8525,8311,8792,8531,2297,273
0,3162,
3617,1002,893,1694,1807,975,894,1873,1844,1752,1
952,1815,1391,5260,5150,4743,4444,4515,4502,4560
,4776,61
94,6217,6159,6464,4897,4458,4686,4505,4666,4884,
4693,4668,4315,4407,5266,5191,5382,5385,4804,469
4,4697,4

747,5281,5696,2621,2459,2851,2837,1925,1654,1709,1868,2757,2413,2488,2676,1657,1735,1009,955,1277,1715,1848,1926,2737,2422,2471,2514,2841,2298,2419,2529,3364,3394,3604,3335,5165,5220,4517,4888,4898,4707,4698,4506,5760,5171,4327,4784,5268,5166,4749,4344,4465,4286,4460,4750,4755,4431,5195,5386,6277,6196,6167,6278,4576,4411,4317,4466,3221,3174,3177,3376,2622,2461,2651,2414,2516,2703,2948,2853,1710,1764,1874,1399,5393,5637,5224,5282,4709,4518,4521,4547,3368,3235,3164,3119,1468,1494,1004,1010,1507,1439,1509,1929,3339,3457,3618,3396,2663,2732,2758,2477,3280,3458,2842,2300,4710,4639,4331,4508,4439,4468,5173,5313,2421,2653,2896,2738,3222,3225,2761,2680,1819,1497,1658,1768,2530,2854,2475,2952,1876,1984,957,983,2462,2271,3237,3178,8410,8560,8844,8422,8583,8505,9266,9289,8642,8734,9231,9536,8526,8425,8747,8966,1889,1717,1821,1930,1739,1831,1498,1660,4871,4413,4318,4522,4549,4333,4655,4929,8367,8315,9349,9268,8850,8804,8533,8969,10307,10281,10384,10268,8412,8506,8616,8587,2711,2740,2883,2667,3127,3400,3608,3649,2520,2503,2844,2857,3620,3185,3226,3151,5272,5197,5284,5888,5388,5394,4900,4808,6528,6220,7170,7172,6281,6226,6200,6171,958,987,1718,1278,1741,1599,1012,999,2762,2769,3341,3180,2885,2764,2912,2858,8865,8775,9239,9350,8547,8479,8375,8426,8317,8749,8852,8808,9600,9292,8534,8508,6241,6183,6403,6228,4930,4757,4904,4875,4713,4700,4529,4816,4912,4932,4443,4993,2654,2960,2770,2744,3650,3296,3238,3591,5638,5174,5203,5177,4339,4758,5641,5232,2425,2483,2865,2367,2669,2860,2532,2478,2886,2715,3624,3267,3342,3713,3595,3347,2536,2287,2426,2507,2670,2675,3652,3363,3131,3241,2485,2428,2866,2509,2544,2717,6282,6289,6405,6173,4550,4414,4771,4714,4994,4877,4472,4524,6187,6242,6659,6232,8433,8970,9353,9298,8755,8537,8644,8589,8595,8399,9272,9243,8866,8750,8977,8624,1937,1822,1835,1403,1721,1455,1016,767,2727,2772,2889,2677,1631,1513,1890,1747,3632,3186,3349,3228,3159,3269,2399,2515,1510,1932,1742,1837,1500,1880,1863,1749,2486,2785,2299,2510,2490,2489,3188,3242,7176,7184,6284,6174,4761,4832,4663,4936,4721,4334,5255,5198,6290,6215,6406,6409,6305,6720,6189,6244,5409,5314,5205,5396,10309,10282,10756,10289,10314,10512,10400,10760,8549,8379,9313,9255,9475,9300,8428,8856,1722,1938,989,1003,1776,1892,1843,1838,1463,1953,1514,1647,1695,1763,1940,1487,3133,3603,3597,3714,3353,3350,3598,3249,6784,6195,6292,6190,5642,5178,4455,4553,8816,8779,8972,8897,8318,8434,8757,8590,9354,9361,8538,8648,9477,9245,8550,8597,4495,4883,4687,4774,4530,4773,5288,5259,1867,1405,990,1005,1521,1954,1845,1750,2517,2295,2731,2890,1985,1896,1516,1655,1753,1724,1467,1765,3365,3460,2786,2947,2718,2831,2897,2868,2776,2976,2839,2415,2949,2678,3163,3656,2733,2892,3841,3270,10528,10768,10432,10784,8495,8761,8436,8787,8381,8758,8868,8553,9259,9314,8898,8781,7200,7171,6219,6410,5219,5206,4445,4341,4554,4762,4716,4459,4223,4287,4878,4503,4532,4722,5180,5400,5209,5410,5649,5644,1869,1944,1406,1846,1875,1754,1522,1904,1766,1469,959,1011,2681,2759,3244,3192,1495,1659,1956,1711,1927,1849,1013,895,8407,8978,9731,9304,10310,10284,10371,10321,9356,9246,8839,8540,8611,8598,8656,8872,10290,10313,10255,10560,8993,8554,8782,8601,8762 ,8980,8789,8764,8411,8503,9362,9287,1524,1870,1769,1850,1756,1470,1986,1960,4667,4561,5316,5261,4777,4342,4803,4446,5221,5267,5296,5262,6417,6661,6248,6306,6197,6337,7173,7232,6296,6221,7177,7174,4695,4764,4886,4556,5650,5441,5151,5320,6308,6912,7185,7178,4345,4778,5210,5665,1499,1877,1891,1661,1931,1511,1719,1770,3273,3408,2301,2739,3134,3354,3215,3175,4669,4507,4899,4885,4805,4461,4536,4724,2872,2950,3250,3366,3165,3716,2734,2788,9478,9481,8900,8790,8793,8843,9377,9792,9261,9316,8613,8984,8994,8803,8794,8602,2898,2423,2492,2518,2531,2463,3274,3664,3395,3464,2533,2953,3369,3842,2843,2521,9856,9267,8423,8880,9364,9262,8845,8440,8561,8382,8556,8846,8851,8527,9291,9482,3179,3252,3223,3281,3356,3720,3166,3276,2682,2792,2900,3008,1852,1777,1878,1881,3370,3472,3680,3424,3397,3605,3227,3282,4785,4470,4519,4562,6412,6418,6662,6198,2913,2741,3377,3619,3372,3181,3256,3606,6227,6201,6665,6256,4889,4346,4467,4577,3609,3187,2845,295 4,2763,2855,3239,3297,5412,5442,5652,5383,5269,5222,5225,5424,4670,4509,4699,4462,4564,4751,4996,4901,1528,1823,1279,1988,3398,3378,2522,2684,10373,10292,10263,10374,8672,8507,8413,8562,9489,9733,9320,9378,8805,8614,8617,8643,5416,5283,5212,5167,5387,5505,5666,5444,4711,4780,4806,4525,5328,5506,4890,4348,2742,2302,2765,2623,2961,2846,3844,3229,4469,4701,4944,4786,5270,5273,4809,4728,12355,12329,12432,12316,12357,12330,12804,12337,8806,8735,8427,8604,8535,8564,9269,9409,8967,8509,8414,8618,8645,8429,8751,9025,9368,9293,9380,9984,9484,9490,8996,8904,4578,4902,4523,5000,6279,6222,6433,6338,3728,3401,2859,2427,2745,2479,2655,2537,2914,2771,2534,2956,1933,1743,1501,1939,1006,1014,1662,1772,1968,1893,1515,1723,1778,1882,1502,1992,1017,1018,1407,1934,4510,4319,5285,5226,6229,6420,6666,6202,4759,4788,4931,4715,5175,5448,5656,5697,1839,2000,1894,1941,3182,3189,2766,2861,4568,4551,4892,4905,6312,6283,6243,6230,2524,2904,2887,2773,1751,1517,1897,1725,5668,5233,5274,5199,4810,4817,5389,5228,4933,4812,4960,4906,4702,5008,4818,4792,5698,5344,5286,5639,6204,6424,6233,6434,4473,4531,4913,4415,4717,4908,4580,4526,3284,3243,3848,3402,2746,2962,2800,2916,2867,2862,2487,2977,3298,3621,2538,2671,10624,10316,11266,11268,10377,10322,10296,10267,10337,10279,10499,10324,9026,8853,9000,8971,8809,8796,8625,8912,9008,9028,8539,9089,9734,9270,9299,9273,8435,8854,9737,9328,4934,4763,5672,5315,5390,5761,5643,5395,6673,6668,6340,6285,4584,4335,4474,4555,4718,4723,5700,5411,6245,6291,6320,6286,5179,5289,4533,4476,4914,4557,4592,4765,10378,10385,10501,10269,8646,8510,8867,8810,12362,12560,12448,12808,12576,12816,12480,12832,9090,8973,8568,8620,10283,10338,10755,10328,11272,11280,10380,10270,8857,8928,8759,9032,2719,2787,2964,2511,2891,2429,2545,2978,4775,4820,4937,4725,6674,6465,6175,6344,5680,5234,5397,5276,5207,5317,4447,4563,4534,4833,4347,4558,6234,6689,6436,6466,6676,6407,6293,6246,4538,4537,5236,5290,3610,3459,3380,3288,3488,3343,3351,3230,12358,12332,12419,12369,12338,12361,12303,12608,8817,8430,9351,9294,10386,10311,10502,10505,3409,3622,3744,3190,3404,3651,3612,3461,5181,5651,5645,5762,5401,5398,5646,5297,10401,10816,10285,10340,9505,9410,9301,9492,10880,10291,10388,10286,9738,9274,8551,8649,4565,4343,4779,4938,5413,5508,4834,4995,1955,1780,1884,1523,3245,3193,3625,3271,2869,2774,3856,3251,1755,1847,1946,1898,3300,3410,3384,3776,3009,2920,3462,3246,2540,2679,3626,3653,2777,2748,2491,2789,6249,6448,6440,6307,4766,4879,4945,4916,6236,6191,6411,6529,4824,5024,4887,4463,3465,3355,3194,3520,1942,1526,1957,1767,8591,8979,8783,8870,8626,8869,9384,9355,11296,11267,10315,10506,9315,9302,8541,8437,3425,3633,3275,3135,1784,1905,1518,1726,2893,2968,2430,2870,1945,1525,1900,1871,3412,3466,3599,3654,3628,3253,3367,3357,991,1020,2016,1471,3304,3196,2899,2778,8650,8858,8812,8555,8319,8383,8974,8599,12421,12340,12311,12422,12672,12364,13314,13316,8628,8818,9276,9496,9305,9506,9745,9740,8763,8657,9412,9357,8873,8438,8899,8542,4997,4726,5211,5704,4781,4940,5889,5318,2546,2928,2790,2493,2519,2683,3277,3254,1757,1851,1958,1906,3715,3634,3358,3657,2980,2735,3371,3426,2951,2873,2548,2894,4729,4807,5292,5240,5321,5456,4349,4787,6690,6468,6352,6530,5182,5402,5263,5223,2793,2874,3283,3473,3257,3468,2780,2494,3010,2984,2523,2901,3416,3658,2915,2685,2955,2535,3717,3665,3607,3312,2743,2794,1961,1987,1771,1529,3278,3167,2876,2801,9317,9363,9392,9358,10513,10757,10344,10402,10293,10433,11269,11328,10392,10317,11273,11270,4920,4998,5298,5414,7186,7296,6294,6297,1879,1948,1758,1853,3399,3636,2902,2905,3872,3474,3428,3379,3373,3489,2552,2847,2303,3012,3285,3640,1007,1015,1989,1962,3904,3660,2957,2767,1908,1530,1773,1969,1990,1779,1883,1964,3258,3718,3476,3299,6309,6250,6199,6472,5213,5764,4782,4836,4946,4471,4540,4566,4579,4511,5322,5712,8791,8860,8982,8652,9746,9537,9247,9416,10404,11008,11281,11274,8441,8874,9306,9761,8765,8603,8995,8981,8901,8557,8632,8820,12425,12370,12344,12315,12385,12327,12547,12372,8881,8566,8615,8658,10508,10514,10758,10294,10323,10297,10761,10352,8985,8442,8563,8673,5443,5512,458

1,5001,5
417,5890,4891,4569,5227,5300,5271,5329,5404,5768
,5214,5324,4730,4840,4948,5056,6680,6721,6692,62
57,6298,
6223,6413,6252,5418,5520,5728,5472,5445,5653,527
5,5330,6722,6368,7180,7201,6310,6663,6696,6339,4
961,478
9,5425,5667,5420,5229,5304,5654,5657,5235,4893,5
002,7233,7188,6414,6785,4811,4903,5287,5345,3968
,3666,25
25,2963,2686,2796,3490,3374,6667,6419,6724,6435,
5446,5426,4570,4732,4790,4350,4813,4671,5009,489
4,5892,5
277,5776,5449,4907,4475,6203,6313,6704,6258,3721
,3843,2992,2917,2539,2747,2802,2906,4793,4527,47
03,4585,
4962,4819,4582,5004,12426,12433,12549,12317,123
31,12386,12803,12376,9508,9538,9748,9479,9365,93
18,9321,
9520,8766,8605,8795,8558,8660,8847,9092,8997,951
2,9379,9308,9263,9483,9601,9762,9540,1854,1935,1
895,166
3,3432,3611,2526,3016,6421,6300,7424,7202,6231,6
341,6260,6314,13320,13328,12428,12318,14336,143
37,14338 ,14340,8807,8876,8902,8621,9424,9602,89
86,8444,2431,2958,2863,3024,3183,3403,2918,2965,
1912,1503,1019,10
21,3286,3381,2775,2541,5230,5237,4814,4909,4572,
4952,4935,4821,5332,5291,5896,5450,4794,5010,484
8,4964,4
915,4910,4535,5025,6205,6675,6669,6786,5346,5669
,4586,4719,4767,4835,5012,4559,2921,2749,3260,35
21,3289,
3480,3681,3668,1970,1774,1993,1532,3623,3722,330
1,3231,4939,4477,4593,5026,5658,5507,5428,5336,6
425,642
2,6670,6321,6437,6532,7192,7204,6235,6728,6913,6
342,5536,5391,5399,5278,5457,5670,5792,5238,5452
,5699,56
60,5509,5293,5241,5673,5319,4917,4822,5904,5299,
3492,3382,2979,2804,3613,3845,2908,2547,8565,879
7,9040,8
882,9366,9369,8905,8824,8674,8998,8619,9096,1037
5,10318,10529,10434,8606,8415,9381,9322,10325,10
516,107
62,10298,8855,8884,9027,8811,9271,9544,9752,9793
,8664,8647,8988,9001,10408,10379,10339,10326,976
4,9329,
9370,9295,8906,8913,9485,9324,12434,12359,12550,
12553,12449,12864,12333,12388,9029,8908,9056,90
02,8798,
9104,8914,8888,1885,1781,1994,1943,2779,2871,368
2,3729,3405,3191,3672,3411,1899,1886,1782,1972,2
001,194
7,1996,1785,3290,3440,3724,3302,5348,5458,5432,5
824,5057,4968,5510,5294,7175,7297,6316,6264,6345
,6480,62
06,6426,4588,4727,5674,5701,7234,7680,6287,6247,
2970,2922,3463,3385,2966,2550,3522,3614,4825,479
6,4539,4
837,5513,5403,5242,5568,9794,9440,9382,9735,1030
0,10520,10329,10530,8569,8627,9009,8511,8813,900
4,8676,
8622,9030,8859,9768,9411,9486,9857,9739,9491,107
69,10764,10436,10381,8680,8431,8570,8651,2981,27
91,2808 ,2929,3406,3305,3627,3846,1901,1976,1519,
1727,3247,3195,3730,3684,2542,2750,2969,2549,341
3,3849,3292,338
6,5473,5681,5323,5183,4941,5016,4478,4918,5460,5
514,5647,5702,5676,5301,5415,5405,3496,3467,3745
,3655,19
59,2002,1907,1786,3427,3359,3255,3306,3197,3629,
3732,3688,1527,1949,1902,1759,3414,3388,3313,385
0,5352,5
244,4947,4826,6322,6438,6237,6788,3635,3417,3524
,3469,2924,2895,3040,2495,3475,3279,2781,2875,20
17,1909,
1963,2018,6346,6736,6467,6536,6441,6914,6251,632
4,8814,8819,9796,9507,10341,10387,10416,10382,92
75,9385 ,8629,8572,9010,8653,8688,8861,8871,8916,
9033,8821,10770,10561,10271,10440,9776,9330,949
3,9372,9303,941
3,8543,8659,12928,12339,12436,12334,13344,13315,
12363,12554,12561,12805,12392,12450,12341,12481
,13317,
13376,7179,7208,6295,6353,4594,4976,4838,4541,37
46,3630,3857,3504,2982,2930,2985,3011,8630,8929,
8443,86
54,10330,10785,10532,10562,10772,10503,10389,10
342,8634,8633,9332,9386,4567,4731,5325,5302,5763
,5682,54
06,5705,3429,3259,3308,3736,2795,2553,2903,2972,
5028,4783,5419,5474,6428,6792,6238,6348,2782,287
7,3013,2
986,3696,3659,3852,3777,9277,9747,9741,9858,9497
,9494,9742,9393,8661,8439,8875,9034,9509,9604,89
30,9091,
10345,10544,10536,10403,8862,8975,9041,9012,103
32,10287,10507,10625,8920,9120,8983,8559,6442,65
44,6752,
6496,4999,4921,4596,4942,4841,4922,5331,5521,530
5,5516,4828,4542,5058,5032,4571,4949,5464,5706,4
963,473
3,2004,1950,1788,1965,2932,2554,2797,2993,12440,
12365,13321,13318,12452,13056,13329,13322,9093,
8822,930
7,9800,8877,9036,9985,9414,8825,8903,9388,9336,9
417,9552,8445,8883,10786,10564,10448,10626,9278,
9498,93
59,9319,1991,1910,1855,1971,3198,3314,3014,2803,
5003,4583,5765,5713,6469,6677,6299,6354,9016,909
4,9394,9
510,11282,11392,10390,10393,12556,12562,12806,1
2342,12371,12345,12809,12400,6449,6691,6444,625
3,7236,7
298,7187,7181,2907,2988,3637,3470,3418,3528,3430,3477,5655,5360,4791,4842,6328,6678,6681,6259,53
26,5215,
4924,4849,5447,5684,4950,4953,6311,6369,6470,645
0,6916,6301,6800,6473,1022,1023,1531,1913,3375,3
641,331
6,3667,2878,2959,2919,2687,2936,2527,3261,3638,5
920,5522,5476,5427,5421,5537,4600,4895,7216,7182
,6254,62
61,6356,6315,6920,6474,2994,2798,3017,2556,2909,
2805,3018,2967,2008,1775,1966,2020,2923,2910,280
6,2996,3
748,3433,3778,3661,3287,3858,3719,3420,4351,5060
,5333,5688,6370,6693,7240,7425,1995,1914,1533,19
73,3491,
3478,3536,3752,1997,2024,1916,1974,3873,3434,366
2,3481,3642,3860,3669,3644,3291,3383,3025,2971,1
0405,10
346,10295,10568,9309,9860,8878,8932,9042,8567,86
36,8662,8675,8607,9418,9808,12423,12366,12577,12
482,123
73,12564,12810,12346,9539,9608,8677,9097,9513,99
86,8987,8665,9323,9396,9367,9425,9500,9864,9310,
9420,88
26,8936,9044,9152,10776,10817,10788,10353,10394,
10319,10509,10348,9514,9616,9824,9568,9541,9749,
9371,94
26,10818,10464,11276,11297,5952,5708,5005,4815,5
306,5766,5524,5347,3780,3670,3673,3723,3493,3864
,3874,3
683,6016,5714,4573,5011,4734,4844,5538,5422,3674
,3482,3303,3760,1887,1783,2032,1534,3020,2809,37
25,3320,
3441,3262,3436,3726,5769,5891,5040,4965,4587,479
5,4850,4954,5480,5659,4574,5064,4479,5006,4911,5
072,668
2,6531,6452,6360,7189,7300,6560,6415,10406,10759
,10792,10435,9057,8885,9521,9763,9516,9325,9400,
9750,97
53,9331,8989,9098,11329,11284,10510,10881,8907,8
999,9383,9441,10763,10515,10820,10531,9542,9522,
8666,88
28,8886,8446,8909,8767,9105,8990,9988,9373,9872,
9545,9003,8571,10299,10409,10800,10354,12456,12
427,1238
7,12374,12348,12568,12377,12578,8889,8623,8799,8
681,9058,8915,8678,9100,6423,6302,6481,6694,6816
,6262,6
476,6723,5231,5451,4966,5013,5334,5429,4823,4589
,4969,4797,5308,5569,5337,5528,5729,5716,3731,34
07,3552,
3387,3293,3442,2925,3000,10517,10396,11520,1129
8,10327,10437,10356,10410,9326,9333,8910,9005,86
68,9048,
9031,8917,6684,6533,6317,6265,6697,6343,6928,632
3,2543,2751,2983,3026,2003,1977,1787,1998,2931,2
810,255
1,2973,2926,2783,3685,3494,6372,6482,6456,6848,7
203,7426,6534,6318,5671,5770,5349,5279,5540,5430
,5027,48
52,6698,6725,6537,6427,5661,5893,4956,4595,9428,
9387,9992,9546,8890,9106,8944,9060,9011,9006,863
1,9121,1
0301,10771,10765,10882,4827,4919,5730,5777,5453,
5239,5720,5459,6266,6592,6497,6705,5338,5488,577
2,5350,
3497,3523,3041,2933,3686,3615,3307,3484,5018,497
0,5511,5433,5014,4598,5570,5662,3415,3444,3847,3
389,197
8,1903,2005,2006,5029,4839,4856,4977,6347,6207,6
484,6538,3294,3498,3525,3309,3631,3905,3876,3784
,3906,37
33,3880,3851,2987,3042,3689,3676,9442,9765,8682,
8815,8863,8931,9108,8655,9035,8573,8689,9122,975
4,9603,9
524,9432,5454,5353,5675,5894,5295,5243,5778,5732
,6671,6726,6700,6325,7194,7681,7248,7205,4590,47
98,5017,
4597,5461,5897,5340,5434,7193,7190,6439,6429,637
6,6268,6349,6326,10521,10518,10766,10417,10533,1
0628,11
288,11300,10331,10824,11009,10438,9632,9487,949
5,9374,12817,12812,12484,12429,14344,14352,1436
8,14339,
12389,12435,12464,12430,12818,12609,12319,12488
,1951,2019,1789,1980,3505,3792,3028,2974,3888,39
08,3419,
3969,1911,2009,2021,2010,5544,5515,5793,5703,678
7,6706,6430,6729,5475,5407,5303,5354,5245,5677,5
780,573
6,12378,12833,12580,12610,12820,12551,12437,123
90,9553,9766,9888,9334,9548,9795,9756,9605,9389,
9337,976
9,9415,9013,8918,10000,9395,9444,9554,9528,9920,
9153,9064,9606,9390,5462,5436,5361,5898,5683,546
5,5572,5
517,7304,7428,6443,6498,6355,6545,7432,7206,1127
1,11393,10412,10360,10441,10576,10302,10522,868
4,8823,9
770,9797,11330,11776,10383,10343,4972,4943,5088,
4543,5523,5327,4829,4923,5794,5678,5905,5552,503
0,4978,
5033,5059,5477,5307,5356,5784,7682,7264,6329,654
0,6488,6730,7235,7209,7312,7196,6789,6737,4843,4
601,495
1,5020,4830,4925,5061,5034,5744,5707,5900,5825,7
237,7210,6679,6384,6350,6239,6471,6708,4980,4602
,4845,50
41,5246,5362,5062,4851,4955,5036,5685,5518,12393
,12592,12584,12451,12380,12335,12555,12673,8921,
8892,86
35,8933,9609,9499,9338,9664,9569,9777,9419,9279,
9037,9112,8574,9014,12834,12612,12496,12674,133
30,13440 ,12438,12441,3315,3734,3526,3390,3747,3
690,2812,2989,3970,3853,3015,2934,1967,1915,2022
,1790,5466,5576,5
478,5525,5423,5689,5364,5715,3448,3500,2879,2995,3737,3808,3639,3912,7684,7217,6944,6546,6500,6451,6445,6561,6357,6712,6976,6732,4926,5007,4967,4735,2555,2937,3697,3310,3431,3529,3471,3859,3032,2799,3663,3750,3506,3749,3421,3317,4984,4575,5309,5686,5042,4846,5065,4604,4957,4853,5066,5015,6330,6790,6548,6371,14341,14400,14345,14342,12453,12394,12343,12616,9556,9610,9743,9798,9772,9397,9511,9501,9448,9340,9043,8922,10418,10534,10333,10884,12824,12865,12836,12401,12442,12367,12557,12396,12866,12512,13324,13345,12454,12807,12840,12483,10442,10832,10563,10632,10537,11010,10347,10420,3530,3738,3692,3435,1535,2012,2025,1975,3199,3263,3854,3479,3508,3698,3643,3537,2990,3044,3753,3318,3019,2938,3779,3422,3671,3740,3862,3532,3321,3754,2557,2997,7040,6738,7242,7440,7328,7688,7456,7696,6562,6446,6793,6915,7360,7712,6504,6683,13377,13332,12558,12929,12811,12563,12868,12579,11275,11304,10391,10449,8690,9072,8934,8637,8663,8827,9421,9398,9859,9778,9502,9801,9124,8879,9515,9570,10524,10888,10334,10444,3645,3483,3021,3048,2026,1917,1999,1918,2940,2998,3875,3861,3781,3437,3512,3700,4971,4958,4854,5044,5796,5481,5826,5709,3761,3446,3495,3538,2911,2807,3865,3322,3443,3553,3646,3485,3056,2558,3675,3438,6255,6475,6358,6453,5335,5906,5767,5468,5539,5526,5584,5800,5921,5482,5710,5529,5690,5908,5717,5692,5339,5431,5073,5019,5828,5718,5721,5771,6332,6593,7238,7212,5541,5912,5922,5731,7299,7249,6361,6552,14353,14346,14354,14464,12347,12457,12848,12402,10538,10640,10848,10592,9095,9017,8692,9038,8937,9018,9427,9617,9401,9612,8924,8638,9154,9128,8667,9045,9560,9802,9059,8829,9099,8679,9861,9809,10565,10773,10395,10450,10545,10787,10540,10349,11332,11394,11283,11277,3540,3727,3972,3877,3027,3001,3687,3756,3782,3501,3866,3324,2811,3022,3445,3677,3920,3762,3002,2927,2033,1979,2028,2034,5722,5530,5351,5808,6753,6740,6695,6794,3029,3030,3785,3704,3554,3878,3499,3976,3486,3295,3735,3764,1981,2007,1982,2011,2975,3043,3907,3691,3544,3527,3868,3881,3786,3793,2813,3004,3909,3788,3936,3882,9751,9456,8887,8938,10424,10774,10777,10355,9422,9311,9020,8945,9543,9780,9046,9049,10407,10465,10566,10546,11012,10397,10896,10569,12565,12444,13568,13346,12375,12485,12404,12458,12349,12819,12813,12930,14348,14369,14401,14356,12569,12566,12814,12465,14592,14370,14360,14372,10016,9618,9572,9523,9517,9633,8696,8991,11312,11278,10350,10357,10452,10411,11016,10570,12581,12676,13336,13348,14343,14465,14402,14848,8447,9156,9429,9784,10466,10789,11336,11521,2935,3033,3678,3984,3794,3768,3449,3507,3889,3391,3045,3034,3693,3884,3556,3502,6373,6303,6564,6454,5068,4857,5773,5368,6685,6917,6754,6801,6477,6263,6744,6483,10048,9804,9101,8911,9402,9862,9620,9443,10112,9810,8669,9107,8830,8940,9634,9518,5489,5310,5484,5774,6362,6512,6796,6374,6535,6457,7218,7241,5779,5455,5600,5435,5341,5490,4973,5048,4591,4799,5031,5074,4979,4858,4599,5021,6594,6686,7183,7488,6478,6377,6699,6918,4974,4831,5733,5542,6319,6267,7301,7220,5545,5571,5089,4981,6802,6756,6485,6921,6364,6458,6568,6539,6817,6727,7191,7302,6499,6431,6327,6378,5734,5663,5355,5532,5463,5492,5895,5437,3910,3739,3560,3311,3450,3531,3694,3699,6269,6701,6804,6760,7552,7244,6486,6460,6385,6922,7305,7250,6707,6489,6596,6541,9865,9987,9136,9061,8683,8891,8946,9050,12379,12872,13057,12486,13319,13441,12460,12408,5342,5546,5573,5357,6547,6351,7224,7195,6818,6702,6929,6576,6501,6331,7265,7207,12489,12624,12350,12570,13378,13824,12431,12391,9576,9755,8670,9160,8575,9102,9007,9168,7427,7252,6380,6808,5679,5953,5924,5832,5954,5781,5928,5899,6768,6731,6924,6849,10778,10627,10548,10456,11285,11396,10656,10511,10519,10398,10577,10790,10912,10358,10572,10819,9327,9547,9062 ,9109,9430,9525,8919,8685,9065,8893,9404,9665,9433,9624,9825,9812,2991,2939,3509,3452,3046,2814,3890,3533,6270,6386,6709,6542,5035,5090,5737,5724,10780,10629,10413,10361,10793,10439,11024,10419,10468,10578,10552,10944,11299,11522,10630,10414,9767,9866,9445,9375,9636,9526,9123,8948,10794,10821,10633,10523,9757,9989,9052,8691,5553,5840,5076,5022,5936,5956,5467,6017,5363,5782,5574,5438,7306,7313,6490,6600,8923,9015,9826,9873,9549,9335,9816,9555,10362,10688,105

93,10801,9434,9584,9868,9446,9114,9066,9607,9529
,9110,8
694,9666,9758,12466,12582,12381,12932,12490,128
80,12611,12680,7429,7197,6502,6549,5795,5738,486
0,5037,6
018,5901,5063,4982,5496,5548,4927,5043,5785,5856
,5687,5960,4603,4985,5745,5358,3568,3741,3751,37
96,2559,
3036,3913,3701,2036,2023,2040,1791,3423,3539,351
0,3809,3323,3534,3514,3513,3049,2999,3541,3319,3
755,391
4,3810,3971,3050,2941,3742,3855,2013,2027,2014,2
029,3023,2942,3921,3892,9125,8935,8952,9073,1044
3,10303,
10580,10634,12585,13058,12395,12468,13323,13352
,12439,12497,9550,9449,9771,9990,9391,9339,9874,
9828,10
767,10822,10796,10421,11290,11777,11344,11301,3
800,4000,3863,3439,3973,3702,3757,3916,6447,6713
,6388,67
39,5479,5577,5519,5907,8686,8894,9113,8693,9557,
9993,9436,9530,12572,12936,12382,12492,12586,12
688,1289
6,12640,5080,4847,5711,5798,5554,5797,5469,5365,
3705,3783,3057,3003,3325,3763,3896,3974,11289,11
286,105
35,10525,10472,10364,10445,10422,9640,9611,9889,
9799,10883,10802,10526,10825,9571,9503,9399,945
0,9341,9
773,9876,9832,9558,9532,9457,9994,9779,9561,9668
,9613,11400,11524,10539,10594,10451,10641,11528,
11302,1
2613,12821,12443,12498,12593,12835,12588,12397,
9068,9039,9184,8639,9619,9423,8925,9019,9890,977
4,10001,
9648,9126,9074,9129,9155,6333,6710,6820,6505,721
1,7266,6850,6733,5578,5786,5740,5483,5247,5311,5
902,552
7,5556,5746,5691,5585,5038,5092,5801,5366,6359,6
930,7683,7256,5067,4986,5827,5470,9573,9403,9452
,9880,11
778,11360,10425,10636,10584,10826,11331,11305,1
1408,11292,10885,10833,13380,13442,13331,13325,
12472,12
822,12825,12403,8939,8697,9047,9116,8926,9021,91
57,9130,9840,9803,9996,9921,11333,11306,10775,10
480,124
55,12513,12614,12594,13060,12445,12944,12617,10
446,10335,10567,10804,9076,8698,8941,9137,9342,9
458,915
8,8947,9051,9132,9781,9614,5719,5788,5910,5580,5
369,5802,4605,5045,5693,5531,5069,5096,4988,5046
,5923,59
09,9562,9672,9574,9621,9519,9785,9460,9811,13360
,13326,12398,12405,12500,12459,13064,12618,1178
0,11313,
11040,10642,10596,10547,10541,10657,10453,10808
,11072,10828,9022,9103,9063,8831,9080,8671,9405,
9782,91
38,8942,9161,8700,12514,12837,13384,13569,12826,
12675,12596,12504,13333,13444,12704,12559,12567
,12446,
12625,12838,9053,8949,9162,9111,10426,10886,106
44,10467,7308,7198,6791,6492,6563,6550,6608,6824
,6945,65
06,6734,6553,6714,6932,6741,6716,6363,6455,7314,
7239,7430,7433,6852,6742,6745,6795,7329,7744,721
3,7268,6
565,6936,11136,10834,11338,11536,11424,11784,11
552,11792,10658,10542,10889,11011,11456,11808,1
0600,107
79,9067,9054,8950,9140,9892,9577,9922,9805,10351
,10571,10454,10549,9431,10002,9863,9564,3758,381
2,3922,
3447,3516,3542,3052,3058,6946,6755,6746,6554,780
8,7219,6375,6832,5829,5485,5560,5748,7316,7214,6
797,639
2,3555,3487,3557,3977,3867,3545,3706,3816,6513,6
334,6508,6798,6803,6479,7243,7434,5809,5494,5543
,5586,66
24,6459,6365,6514,4959,4855,5913,5370,7441,7685,
7272,7330,5491,5601,5694,5533,5104,4606,5723,548
6,12960,
12406,12620,12867,12828,12677,12461,12409,9635,
9622,9680,9896,10017,9578,9806,9625,12841,12487,
13072,1
2467,12516,12626,12600,12992,9786,10004,9813,97
88,9435,9527,9169,9115,6757,6566,6569,6595,6758,
6687,637
9,6556,3924,4032,3005,3031,3937,3765,3869,3978,6
487,6516,7221,7361,6919,6461,6366,6570,3787,3879
,3546,37
08,3006,3035,3766,3326,5588,5775,6020,5925,5075,
5049,5735,5804,3789,3647,3060,3047,3985,3870,388
3,3451,6
597,6381,6703,6977,7320,7245,7332,7936,7436,7442
,6948,6856,6978,6805,6952,6923,1983,2035,2037,19
19,3769,
3503,3064,2815,6761,6748,6577,6864,5830,5549,591
4,5372,9924,9814,9817,9867,10428,10689,11334,113
08,9637 ,10008,10018,9827,11395,11345,10457,1064
8,4859,5070,5493,5725,5968,5810,5050,4975,5077,5
078,5833,5752,6
960,6980,6491,7041,3679,3561,3938,3795,3558,3980
,3790,3885,7686,7222,7251,7225,6387,6806,7689,72
80,5602,
5926,5547,6024,6598,6462,6819,6762,5534,5343,578
3,5812,5023,5091,5955,5739,9818,9626,9447,9904,1
0849,10
836,10791,10890,10469,10399,10660,10550,9164,89
53,9869,9464,13347,13570,12678,12462,12842,1286
9,12681,
12571,10781,11013,10850,10897,10573,10359,10840
,10579,5592,5575,5916,5929,7042,6925,6520,6572,6
809,688
0,6711,6984,5834,5841,4861,5052,5957,5836,5984,5

930,4983,5081,5726,6032,6769,6382,7303,7246,5842,5816,5497,5555,5937,5439,5093,5082,7457,7362,7253,7444,7690,7226,6503,6601,5741,5932,5604,5550,3548,3928,3911,3797,3770,3986,3037,3051,6543,6931,6735,6822,5958,5787,5608,5359,9585,9406,9580,9870,10458,10608,10892,10470,14347,14376,14404,14466,12410,12736,12641,12849,3824,3940,3891,3886,3511,4001,3562,3695,6578,6821,7336,7307,5498,5579,5742,5747,7267,7254,6493,6389,6602,6810,6764,6507,6271,6335,6926,6551,5039,4987,5557,5500,5094,4862,5938,5581,6580,6770,7228,7448,2030,2038,2041,2042,3743,3811,3988,3535,7257,7458,7697,7692,5616,5789,5799,5844,3915,3453,3038,3053,3569,4002,3893,3798,4033,3944,3564,3703,3801,3772,3515,3813,6715,6609,7364,7309,6825,6390,6851,6494,12491,12351,12628,12682,12815,12870,12844,12469,10631,10553,11314,11337,9875,9551,9696,9531,9437,9586,9069,9144,8687,8895,9127,9170,9075,8954,8695,9117,10690,10782,11279,11584,10574,10473,10795,11014,9070,8927,9829,9638,10415,10363,11397,11316,9641,9667,9185,9077,10898,10852,10581,11017,10460,10554,10664,10635,10913,10823,11287,11398,10595,10527,10423,10474,9830,9759,9451,9628,9559,9588,9991,9533,13338,13825,13392,13349,13337,13334,12583,12573,12520,12412,12493,12470,12931,12850,12574,12873,10365,10797,10900,10856,11648,11340,10582,10556,10481,11018,11401,11346,10803,10585,10692,10637,13448,13572,12587,12642,14355,14349,14384,14350,12499,12689,13576,13350,13826,13408,12473,12684,9438,9642,9669,9453,10643,10447,11320,11291,10914,10798,11025,10672,10597,10427,11361,11303,11523,11348,10476,10904,9775,10049,10020,9928,14408,14593,14357,14468,12632,12874,13379,13353,10050,9877,10024,9995,10864,10827,11020,10945,7269,7315,7344,7310,4607,5084,5961,5749,5471,5587,5558,5857,6743,6812,6934,6604,13456,13340,12933,12881,13381,13354,12823,12528,10366,10482,10805,10638,9131,9186,9833,9820,9649,9936,9172,9118,10032,10052,9563,10113,9459,9878,9670,9534,11402,11409,10586,10696,11525,11293,10598,10645,9891,9834,8956,9133,12494,12383,12615,12852,13828,13361,13088,12690,7698,7489,7199,7368,5371,5582,5562,5561,5097,5047,5589,5367,5803,5962,5858,6019,10114,9997,9159,9078,9592,9644,9023,9139,9881,9952,9783,10056,8699,9081,9841,9454,3917,3992,3454,3894,3923,3802,3570,3952,6393,6826,7258,7713,5098,4989,5790,5903,12644,12595,12589,12705,14371,14594,14362,14849,12501,12856,13120,12876,12474,12934,12692,12515,5071,4990,5969,5940,5848,6048,5911,5487,6717,6555,6947,6933,6021,5750,5805,5964,3814,3517,3007,3059,2015,2044,2031,2039,6853,6509,6584,6772,5753,5831,5105,5051,10543,10809,10484,10835,9575,9673,9615 ,10003,9176,8943,9807,9894,9650,9893,9565,9461,10429,10806,10916,10601,11307,11362,10946,10829,9674,9882,9836,9579,9343,9407,9998,9623,9652,9842,9787,9681,9134,9188,9897,9462,13184,12882,13386,13584,13472,13832,13600,13840,10455,11026,11779,11352,9163,9082,9923,9566,9815,9884,10006,9676,9465,9898,8701,9141,5373,5811,5944,6022,6833,6518,6567,6610,6937,6394,6515,6625,7460,7490,7700,7431,3543,3707,4004,3759,3975,3897,3061,2943,7317,7270,7273,7472,6718,6557,6747,6510,9789,9627,9165,9192,9084,9142,10019,10005,11404,11294,10887,10588,10659,10646,10704,10920,12706,12590,12937,13059,13504,13856,12648,12827,12399,12619,12502,12597,14416,14373,14361,14358,12476,12737,13382,13356,13443,13393,12505,12696,11041,10602,10830,10649,10810,11028,10837,10812,10459,10551,11410,11335,11526,11529,10948,10838,10841,10891,11425,11840,11309,11364,10661,11032,11042,10851,10842,10650,11904,11315,10471,10928,9925,9581,9656,9844,11412,11310,10893,10488,6612,6799,7044,6949,5806,5860,5970,5495,7464,7331,7260,7215,5564,5590,5100,5106,3572,3918,3817,3898,3804,3518,4034,4008,5603,5535,5605,6025,7435,7553,7714,7492,6759,6828,6854,6573,7376,7554,6938,6396,3547,3925,3939,3709,3979,3559,3767,3818,3900,3825,3926,3929,3576,3871,3327,4036,6517,6749,6992,6834,7318,7321,6857,6776,10609,10430,10604,10894,10899,10575,11339,11530,9905,9590,9639,9682,10720,10555,10461,10610,14472,14596,14600,14374,12897,12884,12839,12938,12517,12447,12708,12598,12829,13061,12898,12945,9055,8951,10009,9466,11537,11781,11368,11

426,14850,14432,15360,15361,12621,12407,12888,12627,591
5,5593,5754,5864,6626,6950,6571,7048,5972,6080,5053,5079,6558,6367,7333,7274,9587,9697,9790,9629,9200,87
02,9819,9582,10853,10662,10665,10691,10854,10783,10475,10652,5985,5813,5917,6026,5835,5927,5594,5756,68
07,6836,6979,6763,7223,7496,7704,7745,3981,3791,3549,3987,3054,3062,3710,3820,6616,6599,6940,6953,7716,7
281,7322,7247,5054,5083,5814,5374,5837,5695,5108,5095,6858,6865,7437,7276,6981,6860,7008,6954,10583,106
12,11317,11457,11015,10557,10462,10666,9684,9871,10116,10021,9171,9145,9831,9900,10693,10477,10799,110
73,11416,11341,11428,12032,11532,11538,11044,10952,11074,10901,11048,11019,6750,7056,6866,6840,7746,739
2,7334,7687,4016,3941,3563,3771,3826,3930,3550,4040,6521,6579,6961,6463,6765,6956,6628,6574,6982,6811,77
20,7363,7438,7809,7691,7443,3065,3066,3455,3982,3887,4048,3942,3989,6632,6383,6522,6603,6766,6771,7748,7
459,10857,10844,10673,10960,9926,9645,10010,9468,12506,12656,12940,12518,12679,12601,13362,13385,7227,
7337,6581,6524,6962,6605,6640,6813,6033,5918,5931,5499,5817,5551,5112,4863,6823,6868,6985,6773,5727,560
9,5986,5843,3799,3565,3945,3773,4003,3828,3932,3571,12738,12830,13327,13632,12622,12521,12843,13062,124
63,12411,13445,13364,12946,12900,12629,13065,14403,14377,14480,14364,12508,12602,12712,12683,8955,9166 ,9589,9821,10064,9906,9146,9071,7728,7282,7445,7324,7255,7365,6495,6611,5606,6028,5838,5933,5596,5976,59
59,5845,9173,9174,9929,9848,11056,11076,10587,11137,11782,11318,11347,11321,10483,10902,11785,11376,658
2,6881,6395,6606,6586,6585,7284,7338,5818,6034,5085,5099,5872,5988,5939,5934,9698,10022,9643,10120,1069
4,10558,10915,10858,12961,12871,13335,13446,12643,12575,12471,12522,5559,6049,5610,5743,5791,5859,6036,
5583,7229,7699,7693,7810,7449,7446,7694,7345,12413,12845,12948,12904,13696,13388,12630,12604,9630,9439,
9879,9908,9119,9187,10051,9835,9688,9671,10012,10025,11138,11021,10616,10668,10905,10976,10807,11080,9
930,9937,8957,9148,10053,9932,10080,10026,9079,9177,9822,10128,10865,10478,11399,11342,9938,9912,9593,9
651,3803,3895,3994,3946,3990,3574,4005,3815,5963,5501,5086,5101,5617,6050,5941,5846,3832,3953,3566,3774,
3993,3573,3948,3919,6613,6391,6827,6986,6081,5992,5612,5751,10033,9535,9189,9178,11553,11458,11349,1154
0,12529,13066,13449,13394,12851,12633,12740,12685,12691,12495,13368,13339,12962,12846,13073,12720,1440
5,14378,14852,14385,14410,14608,14496,14856,5849,5820,5563,5861,7461,7556,6882,7043,6814,6927,6993,6964 ,6872,7072,6935,6511,11786,11322,10599,10697,9837,10028,9700,9646,12645,12475,13409,13351,13571,13396,1
2524,12952,10639,11027,10831,10918,10054,9883,9704,9455,10674,10917,11432,11403,9594,9675,9838,9843,12
912,12875,13068,12993,12414,12530,12853,12686,13450,13457,12634,12744,13573,13341,12646,12693,2043,204
5,2046,2047,3039,3068,4064,3519,7045,6774,7259,7752,6829,6988,7937,7366,5965,6040,5502,5942,5971,5850,56
18,6000,5862,5565,5055,5107,6777,6855,7340,7288,11363,11350,10589,10485,10698,10906,10860,10603,10367,1
0431,11022,10647,9135,9083,9653,9596,14624,14864,14528,14880,12591,12857,12532,12883,12477,12854,12964 ,12649,13355,13410,12994,12877,5591,5755,6052,5807,6023,5945,5109,4991,5620,5966,5865,5946,5852,5566,60
82,6056,3805,3899,4006,3954,4009,4035,3819,3577,5595,5973,5987,5757,6027,5607,5815,5866,7369,7504,6397,6
835,7230,7450,7311,7271,6968,7046,7346,7462,7261,7812,6830,6884,9190,8958,10034,9677,10676,10866,11324,
11544,12503,13074,13827,13400,14406,14380,14467,14417,3927,3996,3806,3901,3055,3063,4037,4010,6994,651
9,6588,6614,6627,6559,7370,7760,3956,3578,3821,4017,4038,3827,3931,4012,7491,7560,6629,7049,7465,7938,69
39,6617,7275,7348,7319,7377,7452,7816,7262,7372,6778,6888,6996,7104,5948,5873,5974,5977,11353,11554,117
93,11788,9712,9885,9895,9940,10811,10705,11460,11405,10921,10486,10947,10590,7466,7568,7776,7520,7493,7
701,7323,7378,7009,6837,7473,7715,7468,7277,7352,7702,11365,11411,11440,11406,8703,9180,10057,9845,9567 ,9683,9654,9953,10839,10908,11030,10700,7705,7283,6941,7050,6859,6951,7335,7393,3902,3983,3943,3711,396
0,3551,3067,3069,5624,5919,5375,6084,7494,7474,6618,6780,6838,6398,6861,6719,7057,6942,7940,7325,11794,1
1585,11295,11464,9467,9678,9658,9657,9193,9143,9

685,9463,9899,10058,9954,10115,10489,10922,11354,11809,9194,9085,9886,9999,9167,9086,10065,10036,9944,10144,10007,9583,13452,13342,12935,12636,12707,12694,12752,12968,14386,14409,14351,14656,13089,12650,12878,12697,12858,13076,12885,12860,12507,12599,13458,13383,13574,13577,12996,12886,12889,12939,13473,13888,10813,10651,11043,11029,10117,9846,9901,10060,10949,10605,10680,10868,9849,9927,9201,9147,9469,9907,10040,10118,10929,10614,10663,10706,11033,10490,10611,10721,11556,11586,11796,11527,7824,7497,6955,6523,6841,6575,6751,6633,7010,6867,6630,7052,6029,5839,5597,6035,13357,13412,12709,13080,13090,12899,12890,12698,13952,13363,12519,12976,13460,13358,12941,12536,5102,5110,5758,5868,6064,5989,5611,5819,4018,3822,4041,3580,3933,3829,4042,3991,5874,5978,5598,6088,5113,5114,5503,6030,5935,6096,5990,6037,7278,7285,6862,6957,12657,12478,12652,12942,12947,12623,13387,13578,14469,14388,14359,14470,12768,12603,12509,12658,11413,11366,11369,11568,10814,10653,10843,10606,10708,10895,11140,11045,9902,9956,10066,9591,13585,13829,13416,13474,12901,12710,12713,12739,11560,11427 ,11356,11311,9660,9686,9196,9202,9699,9631,9701,10121,11531,11649,11810,11588,10855,10924,10950,10669,11472,11650,11034,10492,12902,12831,12523,12700,12631,12660,13365,13505,10613,10845,11088,10930,11414,11417,10953,10872,6620,7000,6983,6869,5847,5613,5993,5821,7380,7339,7944,7498,6842,7058,6896,7012,10011,9689,9850,9960,10722,11046,10667,11144,10068,10176,9149,9175,10654,10463,11429,11370,6963,6958,6583,7073,7394,7717,6634,6767,3947,3934,3830,4020,4049,3995,4044,3833,10081,9909,10013,10122,9931,10023,9690,9852,13063,12605,12510,12714,12741,12525,12847,13121,6815,6883,7060,6607,6987,6525,6641,7074,7706,7555,7476,7384,7584,7439,7447,7326,7505,7718,7840,7286,7500,7747,7708,7557,6051,5876,5980,5619,7341,7289,7721,7367,10903,10932,11075,10859,11319,11592,11800,11841,10712,10695,11036,11049,11812,11377,11418,11343,13464,13389,13476,14080,13580,13586,13092,13000,14720,14412,15362,15364,14473,14418,14392,14363,9150,9179,9910,9470,9933,9791,9204,9191,10954,10961,11533,11372,11077,10956,11104,11050,14433,14375,14595,14420,13122,12949,13096,13067,12905,12892,12721,13008,13104,13124,12635,13185,3949,4024,3567,3775,4007,4050,3955,3834,6965,6870,7952,7347,5851,5943,6042,5994,7396,7506,7480,7872,7105,7016,7558,7342,3575,3997,3950,3807,4065,3957,4011,4066,10846,11152,10962,10936,11842,11488,11430,11783,13830,13366,13395,13369,12531,12950,13833,13424,10617,10675,11057,10559,10861,11052,10724,10670,11078,10907,11816,11459,11534,11905,11787,11539,10728,10479,10618,10699,10862,10867,11844,11555,11323,11433,10677,10620,11058,10701,10736,10909,14474,14481,14597,14365,12742,12606,12963,12906,13186,13069,12664,12716,14379,14434,14851,14424,10129,10014,10027,9595,9913,9647,9208,8959,10919,10964,11081,10869,9823,9705,10082,9939,11824,11378,11541,11420,11351,11461,10591,10707,9702,10124,9934,10029,9692,10072,10055,9941,10678,10977,10491,10702,10682,10681,11380,11434,15368,15376,14476,14366,12953,13024,12855,13128,12913,12526,13447,13390,14482,14407,14598,14601,14497,14912,14381,14436,13601,13506,13397,13588,9914,10130,9181,9195,9968,10084,10035,10030,9655,10145,9706,9839,9887,9955,10132,9679,11325,11795,11789,11906,11545,11542,11790,11441,14976,14387,14484,14382,13834,13370,12647,12745,12687,13075,12879,12966,12722,12965,13480,13451,10059,9597,9182,9197,9713,10146,10037,9942,10709,10487,10923,11082,10177,10088,9708,9847,9945,9916,9659,9957,11557,11652,10978,11139,6636,6775,7722,7749,6873,6844,6587,6885,7561,7451,7290,7616,6038,5622,6053,5863,7521,7729,7371,7231,5880,6001,5614,5822,4052,3998,3836,4013,4039,3958,3903,4019,10910,11023,11089,11060 ,10968,11168,11031,10607,11141,10870,11355,11848,10925,11084,12033,11462,6989,7064,6526,6966,6041,5621,5996,5967,7508,7562,7695,7750,7724,7349,7463,7453,15392,15363,14411,14602,13411,13398,12637,12533,12746,12954,12908,12651,12415,12479,13070,12695,12724,12914,13372,13592,13401,13602,13841,13836,10061,10136,9598,10038,10067,9946,9714,10096,5087,5116,6112,5567,7400,7292,6995,6874,6642,7024,6886,6589,6

615,6779,7373,7350,5853,5947,6054,6002,7811,7730,7454,7753,7076,6831,7467,7522,7047,6969,6644,6990,9958,9661,9151,9203,10873,10951,11436,11384,9687,9851,10148,9903,10119,10041,9205,9087,9716,10062,9961,10042,9948,9662,10178,10152,12859,12753,13508,13453,12969,12534,12995,12638,6889,6970,7379,7569,7353,7564,6876,6590,3070,3071,3579,3961,4056,3823,4014,4068,7106,7080,6619,6997,7512,7754,7011,6781,7051,6631,7813,7761,7703,7408,6839,6890,6057,6083,5867,5625,7374,7263,6972,6897,5975,6044,5854,5949,7495,7732,6998,7001,7968,7570,7524,7475,7469,7585,6648,6943,6399,7108,7381,7736,5103,5111,6085,6058,13413,13459,13488,13454,14609 ,14853,14440,14498,14389,14529,15365,15424,14488,14413,15369,15366,12887,12956,13078,12748,13842,13633 ,13343,13512,14500,15104,15377,15370,12537,12970,13402,13857,8000,7756,7053,6863,6004,5626,5869,6065,4043,3962,3581,4021,4045,4072,3964,4022,6086,5875,5979,6060,7354,7814,7572,7395,8064,7762,6621,7059,6782,6892,7586,7470,9691,10069,10083,9853,10123,9703,9911,9962,11465,11600,10493,10931,11326,11546,11407,11367,7817,7939,7088,7013,6635,6843,6898,7002,5950,6031,5991,5759,7528,7707,6622,7112,6527,7054,6959,7120,7279,7499,7014,7061,6008,5599,5115,5117,7382,7477,6871,6637,12861,12699,13091,13077,12997,12653,12728,12916,11064,11142,11442,11558,11357,11908,10926,10980,11090,10615,10684,10710,10723,10655,11466,11856,11587,11656,10725,11145,11561,12034,11035,10713,11371,11444,11415,11473,11548,11912,11358,11468,10874,10984,11092,11200,10044,9969,10070,10073,11562,11664,11872,11616,11589,11797,11419,11474,12977,12662,12711,12754,14604,14610,14854,14390,11105,10933,11569,11811,11564,11373,11448,11798,14419,14393,14857,14448,13081,12538,12659,12769,7017,6845,7356,7617,7385,7576,7777,7764,6066,5870,6089,5628,7719,7818,7397,7327 ,7588,7478,7075,6900,7709,7941,7004,6643,5981,5877,6090,6039,6875,6967,7778,7825,7501,7287,7768,7507,5995,5982,5878,6068,3935,3831,4080,3582,4051,4025,3835,4046,11801,11379,11037,11146,10955,11047,11431,11489,13604,13634,13844,13575,13461,13414,13417,13616,6097,6043,6092,5881,7386,7536,7820,7398,7066,7018,7559,7481,7062,6646,7618,7710,7077,6887,6904,7025,7502,7401,7723,7942,4026,3951,4053,4054,3999,4067,3837,4028,5997,6072,5615,5823,7343,7291,7826,7780,6638,6846,7065,6645,7509,7945,7388,7482,7592,7563,7841,7751,6055,6098,6003,5882,7523,7455,7351,7402,7293,7725,7828,7784,5623,6045,5998,5855,7510,7484,7409,7946,7731,7513,7620,7565,7020,6991,7136,6591,7571,7375,6877,6971,6113,6005,6059,6114,7842,7726,7953,7600,7078,7026,7081,7107,12862,12701,12891,12654,12756,12943,13188,13093,9720,10015,9471,10180,11590,11570,10714,10876,13608,13475,13404,13359,13579,13697,13858,13636,12903,12972,12998,12717,13520,13698,13082,12540,10934,10494,10957,10815,11153,11038,12036,11421,12661,12893,13136,12978,13462,13465,13001,12920,12770,13094,12715,13192,14471,14414,14625,14530,11920,11593,11051,10619,10937,10671,10847,10729,11106,10963,10726,11148,10125,9935,9693,10131,9198,9206,9854,9964,10160,10085,9707,9915,9970,10074,9694,10184,9209,9210,9599,10126,12702,12511,13477,13418,14421,14612,14858,14394,12951,12980,13123,12907,13367,13640,13848,13889,10031,10192,10086,10133,11374,11381,10958,11053,12760,12743,13084,13097,14504,14475,14435,14422,10716,11096,11079,10965,9943,9709,10089,9917,13860,13425,13466,13391,13002,13009,13581,13420,13125,13004,13152,13098,12894,13200,13010,12984,13890,13536,13478,13831,14396,14616,14425,14626,12665,12723,13105,12607,12909,13100,12772,12718,11476,11435,12040,11594,10938,11154,10992,11108,11059,11054,10679,11169,11490,11813,10730,10863,7525,7355,7404,7832,6891,6649,6999,7068,6878,6973,7109,7082,7792,7755,7948 ,7873,13126,12955,13864,13507,13582,13953,13835,13587,14865,14860,14532,14477,12776,12527,12666,12747,12910,12915,13892,13603,14437,14483,14512,14478,13371,13481,12725,12668,13106,12749,12784,12957,10911,10979,11156,10703,11083,10621,10737,11170,12967,13012,13129,12917,14866,14657,14367,14536,13872,13426,13589,13468,13399,13509,12639,12755,12726,13025,12539,12750,14426,14881,14628,14658,14868,14599,14485,14438,12730,12729,13428,13482,11802,11651,11572,11480,11680,11535,11543,11422,11601,11814,1193

6,11382,11596,11843,11804,11653,13373,13843,13837,13954,13593,13590,13838,13489,6100,6046,5884,6061,7028,6650,6893,7089,6087,6006,5951,6067,7294,7410,7110,6899,12757,12535,12971,13130,13605,13700,13026,13187,10147,9972,10076,9715,11437,11385,11817,11463,11061,10966,12048,11443,9947,10039,10138,10090,11492,11602,11576,11968,11201,11112,11654,11438,10732,10871,11818,11845,10969,10940,10683,10981,14441,14640,14632,14499,12958,13071,13137,13108,14428,14383,14603,14721,13016,13216,13079,12655,11657,11547,11386,11712,10134,9718,10149,9959,11617,11825,11467,11327,9976,10097,9710,9918,11085,11160,10622,11062,10137,9717,10092,10063,11604,11658,11791,11846,11820,11445,11559,11549,9183,9212,10208,9663,11496,11388,11091,10970,7003,7084,7733,7566,7514,7624,7526,7573,5118,5119,5627,6009,7471,7737,7412,7763,3959,4057,4069,4058,4015,3963,4070,3838,6974,7055,7015,6783,7032,6623,7357,7734,7090,6894,7113,6652,7005,6901,7114,7063,6104,5871,6062,6116,7019,7006,6902,7092,7844,7529,7874,7757,7383,7954,7815,7516,6091,6010,5629,6069,7587,7574,7632,7848,3583,4060,4073,4023,4074,3965,4047,3966,6093,6120,6012,6070,7969,7530,7758,7577,7738,7956,7765,7740,7387,7479,7121,7067,7876,7766,7769,7819,7589,7960,7970,7779,13189,12918,13403,13896,12973,13132,14081,13510,10738,11120,10982,10685,10711,10875,11469,11446,9949,10043,10150,10098,11907,11826,11550,11849,11172,10927,11563,11618,11143,11065,10740,11086,7770,7578,7399,7856,5983,5879,6128,5630,7116,6905,7821,7416,7537,7358,7532,7822,12921,12999,13484,13432,13513,13648,12541,12979,14882,14660,14544,14722,13374,13594,13455,13415,10985,11066,11475,11665,11449,11660,10972,10686,11202,11176,10715,11093,11608,11850,11107,10877,11147,10727,11909,11857,11799,11504,10935,10986,10153,10179,9963,9721,11470,11359,11068,10993,13112,13190,13490,13606,15378,15488,14486,14489,10071,10140,9950,10045,11591,11828,11094,11097,12064,11666,11620,11571,11565,11681,10744,11039,10495,11204,11477,11832,9199,9207,10181,10154,12096,11852,11149,10959,10100,9722,9965,10161,10182,9971,10075,10156,11450,11910,11668,11491,14501,14442,14391,14664,13405,13956,12974,13028,13138,12663,12732,12758,12771,12703,13514,13904,13635,13704,12773,13193,13609,14082,13083,12761,13419,13492,13463,13521,13596,13960,13406,13516,12922,13032,13140,13248,14872,14913,14884,14449,14490,14415,14605,14444,13610,13712,13920,13664,13637,13845,13467,13522,14914,14560,15372,15393,14502,14855,14888,14531,13153,12981,13617,13859,7827,7503,7648,7483,7389,7538,7021,7096,6639,6847,7079,7122,6099,6073,5883,6094,13612,13421,13496,13846,13849,13427,13085,13194,15425,15380,14606,14977,13003,13095,13479,13537,12160,11858,10717,11155,10878,10988,11682,11566,14859,14611,14916,14627,13638,13618,12762,12924,7027,6906,6647,7069,7022,6879,7781,7590,7593,7619,7137,7029,7782,7711,7403,7580,12982,12542,13005,12863,13201,13086,14084,13469,13968,13641,13099,12667,14395,14505,14896,14450,11913,12035,11184,11109,10731,10939,10994,11098,12985,12719,12895,12777,13154,13011,12774,13196,10046,10127,10087,9855,11624,11803,10718,11208,14613,14492,15616,15394,14423,14533,14452,14506,10623,11150,11055,11216,11375,11595,11110,11157,10104,9695,9211,9213,11478,11573,10967,10733,13422,13429,13006,13101,12764,13144,13127,13013,13524,13483,14088,13642,12986,13202,13040,13156,7511,7540,7943,7485,6074,5999,6101,6102,7390,7594,7621,7405,7727,8001,7972,7880,13107,13102,12727,13217,14397,14867,14861,14978,13538,13861,12778,12911,12959,13027,13204,12751,8002,7829,7976,7947,7083,7138,7785,7772,6047,6115,5885,6076,7601,7888,7124,7070,11113,10941,11452,11713,11481,11672,11873,11860,10162,9966,10185,9724,11815,11914,11493,11423,7984,8004,7515,8065,6007,6105,6117,6106,7411,7830,7622,7486,7843,7786,6908,7085,13131,12669,12785,13218,13850,13699,13620,13528,14617,14614,14862,14513,14629,14724,15384,15396,14427,14920,15105,14534,13728,13583,13591,13470,13649,13862,13984,13430,13644,13891,13852,13701,4081,4027,4076,4082,4029,4055,4030,4059,8066,7949,7111,7030,6063,6011,6118,5886,13485,13433,13865,13511,13109,13014,14096,13491,1 1684,11574,11171,10996,11805,12037,11100,10739,10077,9973,10186,10135,10971,11063,11874,11921,11597,11 383,11864,11603,10091,10078,9974,10164,10193,10 139,10188,9977,11482,11632,11916,11494,13540,13 650,1362 4,14016,13249,13160,13702,13486,7544,7596,6975,7 091,7833,7904,7735,8008,6651,7033,7793,7406,7527,7625,7 567,7955,15367,15489,14508,14456,14537,14672,14 398,14618,12780,12919,13866,13893,15426,15872,1 4479,144 39,11162,11114,11655,11577,11158,10742,11714,11 806,13017,12988,12731,13029,13705,13595,13434,1 3760,1117 3,10983,11000,11121,11598,11497,11819,12038,100 93,10168,9711,9919,11439,11387,11922,11876,1073 4,10942,1 1161,10741,11605,12041,11484,11578,13665,13873,13515,13375,13133,13208,12670,13110,13652,13706,13839,1 3894,13868,13493,13607,13597,11688,11659,11937,11847,10151,10194,10099,9978,11619,11551,11447,11498,11 389,11821,11924,11880,9719,10141,10094,9951,116 06,11580,11505,12042,13544,13436,13139,13018,14 514,1463 0,14429,14980,11827,11609,11716,11661,11116,110 87,11232,10687,11667,11471,10973,11067,10209,10 101,1015 5,10210,14538,14928,14659,14728,14633,15106,144 43,14516,15371,15400,14487,14545,12786,13168,13 030,1273 3,11938,11822,12049,11696,11174,11122,11177,112 03,7128,6895,7759,7846,7602,7845,7517,7413,7626,7834,778 8,7531,5631,6108,6121,6071,12759,12923,13517,134 94,13955,13874,13598,13897,11621,11451,11500,11 928,109 87,10745,11095,11164,7295,7359,7950,7575,7604,77 94,7739,7633,7086,7140,7849,7414,7115,7034,7875,7518,13 220,12975,13611,13666,14620,14984,14430,14540,1 0974,11069,11205,11178,11888,11851,12044,11969,14634,14 736,14944,14688,13191,13113,12788,13134,13033,1 3114,13523,13713,13497,13708,13020,12734,13250,13224,12 763,13141,13656,13898,13155,12925,10196,10142,9 980,10157,11124,10746,10989,11185,10183,10102,1 0047,101 63,11390,11506,11206,10995,13195,12775,13957,13 905,14661,14869,14491,14546,4084,4071,4088,3839,4061,40 75,4062,4077,7767,7836,7958,7628,7417,7850,6653,7093,14641,14883,14636,14445,15428,15490,15379,15373,11 099,11180,11829,11662,11610,11720,11622,11669,7 741,7579,7117,7144,6122,6013,6095,6014,7036,7094,7971,79 57,7877,7533,7608,7796,7857,7542,7591,7634,7007,6903,7961,7418,7539,7649,7742,7581,7152,6654,777 1,7534,1 3847,13552,12983,13034,14520,14870,14873,14451,13518,13407,13116,13041,13639,13876,13142,13145,14503,1 4561,14662,14642,15108,14493,14992,14665,9214,9 215,9723,10105,11567,11833,11508,11859,11070,11 151,1111 1,10879,11128,10719,11453,11830,14112,13714,136 68,13619,13613,13729,12792,13087,15408,15374,14 446,1445 3,14548,14507,15112,14666,11186,10990,11209,107 48,11101,10997,11210,11159,10200,9967,10158,102 12,11115, 11102,10998,11188,11940,11625,11970,11853,11479,12050,11911,11612,7636,7823,8068,7973,7123,7097,7783,78 52,7878,7597,7962,7420,6907,7118,7541,7773,12543,13252,13525,13880,14562,14885,15432,15617,1018 7,10106, 9725,10165,11683,11670,11728,11944,10189,10216,10108,10166,12065,11626,11854,11673,11834,12052,11861,1 1836,11483,11575,11217,11163,14144,13900,13197,13007,13498,13958,13716,13539,11972,11862,11865,11915,1 1685,12056,12066,11875,8016,7858,7098,7023,6129,6075,6124,6130,4031,4083,4085,3967,4078,4086,408 9,4090, 14208,13906,12765,13203,12926,13036,13730,13614,11866,11674,11495,11952,10079,9975,10224,9726,1 1212,11 001,11917,11512,11633,11454,11628,11918,13961,1 4083,13232,13157,12779,12987,13042,13146,13672,13851,12 766,13256,12671,13198,13103,13264,14874,14723,1 4644,14552,15381,15492,14752,14607,7125,7126,78 81,7800, 7650,7974,7595,8072,7582,7391,7831,7860,6077,610 3,6078,6107,14615,14494,14673,14886,15008,14454,14668,1 4915,13423,13643,13158,13205,13526,13621,13015,12781,13161,12989,13500,13761,13529,13720,13921,13908,1 1923,11599,11744,11579,11485,11634,11117,11192,14876,14725,14509,14457,14889,14535,15120,14515,10735,1 0943,11175,11218,10195,10169,9979,10190,7071,71 39,8003,7787,7640,7623,7964,7977,7882,7889,6909,7100,800 5,7884,8032,7978,11123,11002,10743,11165,11118,1 0975,11877,11686,14564,14674,14648,15040,15395,15618,14 726,14510,13863,13962,13541,13471,13732,13622,13219,13044,14890,14917,14729,14619,13853,14085,13148,12787,7031,7129,7774,8080,7890,7864,7545,7603,7985,7487,7141,7130,7789,7980,7652,7598,8006,7835,7656,7407,7546,7627,7790,7795,7087,7035,7605,7548,7142,6910,7986,7629,13019,13111,13922,13969,13645,13431,13912,13651,14458,14784,14689,14897,13530,13680,13964,13542,11689,11715,11233,11125,11878,11807,11499,11676,13210,13162,13703,13625,13206,12790,13762,13854,11607,11636,12039,11581,10170,10095,10197,10198,13221,13031,13048,13169,14539,14399,14676,14730,11486,11690,11717,11501,11823,12097,12068,11976,12098,11925,12072,12043,11179,11234,11881,11868,13646,13545,13867,14086,13487,13435,13970,13924,14863,14918,14892,14517,15386,15873,15440,15397,7664,7837,7847,7892,6655,7132,8009,7797,6132,6119,6136,5887,7519,7635,7606 ,7905,12782,12990,13209,12789,13653,14089,13532,13626,15385,15382,14631,14621,14568,14460,14541,14518,10143,10211,9981,10172,11697,11984,11220,11166,12080,12100,11611,12161,10103,10201,10213,10202,13736,13707,13985,13895,14979,14898,14622,14921,13667,13599,13495,13546,13437,13869,13972,13928,13654,13628,13553,14090,13875,13657,13764,13709,15496,15620,14635,14690,14547,14737,15624,15398,7419,7630,7610,7609 ,7145,7095,7637,7415,7851,8010,7906,8067,7146,7037,7838,7951,13164,13135,13280,12735,13715,13519,13021,13115,13986,13870,14097,13744,13222,13170,13225,13251,13669,13499,13548,13976,15874,15456,14521,14732,14680,14922,15427,15401,15504,15388,14981,14929,6109,6123,6110,6125,7119,7038,8017,7988,7896,8096,7959,7535,8069,7798,7853,8012,13035,12793,13143,13212,13022,13117,13253,13226,13936,13899,14092,14017,15429 ,15402,14871,14576,14542,14431,14663,14900,13172,12794,13037,13233,13438,13554,13254,13043,13147,13228 ,13877,13710,11507,11926,11718,11582,11939,11882,11004,11181,12162,12045,11207,11126,10159,10107,10214,9982,13658,13768,13670,13717,13615,13881,13556,13907,11640,11692,11071,11187,11929,12000,11831,12104,7801,7879,7153,7099,7421,7859,7992,8070,7854,7908,8018,7543,7612,7638,7148,7154,15876,15409,15136,14738,14692,14643,14637,14753,14549,14904,15168,14924,13118,13199,13159,12927,10747,11129,11889,11502,11623,11721,11663,12051,11224,10991,11855,11942,11698,11941,11613,11509,13176,12767,13501,13878,13234,13038,13257,12796,13149,13045,13258,13207,14522,14982,14740,14563,11722,11930,11884,11627,9727,10204,10217,10167,11391,11455,12046,11671,11700,11890,11835,11729,11182,11236,11945,11510,11211,11130,11971,11614,11863,11932,12054,11724,11513,11946,10749,11189,15232,14930,15434,15632,15520,15880,15648,15888,14754,14638,14985,15107,15552,15904,14696,14875,7651,7583,7653,8073,7963,7641,7802,7912,8020,8128,7101,7127,8033,7861,7965,8074,11837,11675,11213,11240,10218,10109,10191,10110,11132,11190,12067,12053,11973,11629, 11704,11892,7883,7975,7642,7804,7102,7131,7862,7422,7885,7743,7156,7143,8081,7966,7979,7547,13163,13150,13046,13236,13988,13673,14018,13901,11953,11638,11687,11730,11103,10999,12057,11514,11635,11745,11838,11677,11248,10750,11867,11630,14447,14667,14550,14645,13527,14098,13959,13660,13731,13718,13776,13992,14113,13674,13902,13721,13882,14100,13909,13884,13531,13623, 13265,13211,4063,4092,4079,4087,4091,4093,4094,4095,6079,6131,6133,6015,7865,7599,7160,6911,14020,13910,13913,13963,14524,14785,15430,15404,13733,14104,14114,13923,15491,15441,14553,14744,11732,11919,12164,12069,11219,11193,11879,11948,11974,11693,12058,11516,11003,11214,11637,11869,12112,11954,11194,11119,10225,10171,10220,10226,13914,13722,13543,14000,14945,14932,14887,14986,11221,11222,11977,11896,11746,12070,11691,12168,11678,11487,11927,11956,10173,10199,10174,10203,11167,11235,12099,11883,11736,11719,12060,12073,11978,11985,11005,11196,12101,11980,12128,12074,7775,7657,8034,7891,7654,8076,7886,7981,7644,8024,8007,7893,7866,8082,7133,7147,11127 ,11225,11870,12176,11986,11960,11641,11699,12081,11583,11237,11226,11885,12076,11748,11694,14565,14495,14756,14646,13260,13049,13965,13560,14877,15109,14946,14993,14669,14455,14936,14675,13681,13502,13676,13966,14554,14704,14988,14566,14727,14649,15410,
15433,13971,13647,13792,13627,7920,8036,7987,7982,7607 ,8097,7658,7791,6126,6134,6137,6138,7839,7907,8084,7631,13533,13682,13165,13240,12783,12991,13223,13266 ,13171,13050,12791,13213,14786,14878,15375,15680,8011,7549,7134,7149,7665,8098,7989,7894,8129,8040,7660 ,7799,7897,7868,7611,7909,14670,14569,14891,15110,13166,13023,13925,13734,14511,14459,15493,15412,13737,13763,13281,13173,14994,14948,14677,15113,14556,14650,14760,14731,15009,14919,15383,15494,14691,14623,14519,14570,13926,13855,13547,13724,13655,13684,14087,13629,12102,11931,11752,11503,11642,11723,11886,11891,14461,14893,14996,14952,15744,15436,14678,14652,14577,15114,15497,15442,14899,14681,14788,14733,13534,13738,13765,13549,14739,14543,15416,15387,15010,14894,15121,14768,14693,14523,15457,15399,15619,15444,14572,15000,13871,14145,14116,14024,14146,13973,14120,14091,14960,14923,15116,15041,8013,8088,7550,7990,8019,7898,7666,8048,7910,7613,7103,7155,6111,6140,6127,6135,11183,11131,11701,11644,11238,11006,12082,11725,14462,14578,14901,14734,13227,13282,13929,13916,13745,14032,13268,13214,14128,14148,13659,14209,13555,13974,13766,13630,15498,15505,14682,14792,15621,15389,14694,14741,13987,13930,13052,13229,14210,14093,13255,13174,13688,13740,13119,13235,13977,14048,13879,14152,12795,13177,13937,13550,11760,11933,11943,11988,10751,11228,12105,11893,10228,10215,10232,9983,11615,11731,11702,12001,11515,11726,11706,11705,11241,11191,11733,11511,7639,7803,8100,7855,8071,7993,7157,7039,7668,8014,7913,7994,7900,7614,8130,8104,11947,12106,12002,12163,11242,11133,11934,12047,10205,10219,10206,10221,11215,11134,12113,12084,11992,12192,12055,11631,12165,11894,11949,12108,14639,14905,14580,14931,13671,13769,13711,14099,13272,13039,13903,13990,13746,13989,13661,13557,11897,11975,11249,11195,11517,11955,12088,12166,14525,14902,15012,14697,15403,15458,15042,14925,13770,13978,13932,13675,13439,13503,14094,13719,13748,13938,13883,13777,13230,13284,13993,13558,14551,15122,15875,15448,13259,13178,14019,13662,7643,8021,8035,7805,8075,7655,7863,7914,7996,7921,8022,8025,7672,7967,7423,8132,13911,13980,14102,13772,13561,13994,12797,13237,13885,13723,13261,13288,13180,13238,14115,14101,15500,15390,14983,14684,14755,14742,14800,15016,15137,14698,14926,14745,14906,15124,14933,14908,14555,14647,15506,15431,15622,15625,15044,14934,14937,14987,15521,15936,15405,15460,14757,15128,11950,12004,12114,11639,11708,11734,11244,11250,15138,14947,14938,14746,16000,15411,14567,15024,8077,7887,7645,8083,7150,7158,7806,7916,8112,8037,7659,7867,7922 ,8026,7646,8136,14021,13677,13752,13940,15508,15406,14989,14584,11747,11679,11749,12169,12059,11737,11898,12008,14705,14526,14700,14990,14995,14671,15435,15626,14001,13686,13735,13778,14816,14651,14557,14706,7161,7162,7551,8078,7983,8144,8038,8085,7895,7661,8041,7869,8099,7924,8028,7667,13151,13047,14105,13562,15633,15877,15464,15522,13683,13793,13886,13725,13296,12798,13915,13678,14949,14758,14761,14787,14950,14879,14571,14748,12116,12224,11197,11223,12129,11957,12061,12170,14679,14708,15413,15553,15111,14653,14558,14762,11979,12071,11738,11900,11198,11227,11958,11518,7899,7991,8090,8042,8086,7670,8101,7911,7928,8049,7662,7870,8089,7669,8044,8015,13780,13967,14212,14117,13267,13241,13927,13996,11981,11839,11252,11239,12177,12062,12075,11643,14789,14573,14895,15169,15512,15437,15524,16128,15628,15634,15140,15048,15170,14997,15144,15115,10175,10227,10229,10111,11961,11695,11256,11007,14953,14940,14769,15056,14022,13741,14106,13564,13051,13262,13685,13917,14160,14002,13242,13167,13269,13270,14025,13944,15152,15172,14683,15233,11871,11753,12130,11987,11750,12172,11982,12077,15878,15414,15443,15417,14579,14998,15881,15472,13794,14118,13739,14216,14790,14654,15011,14954,13726,13535,13975,14004,13215,13283,14147,13931,13784,13767,14108,14121,15234,15117,14712,14764,15001,15072,14903,15176,14026,14033,13053,13244,6139,6141,6142,6143,7135,7164,8160,7615,7901,7995,8102,8050,8105,8131,7915,7673,14149,14028,14176,14122,13175,13273,13918,14224,14961,14574,15495,15438,14034,14008,13689,13747,14129,13631,13285,13274,15649,15554,15445,15636,15882,15418,14695,14793,13933,14124,13796,13742,11740,12120,12103,11989,11962,12178, 11229,11243,14735,15123,14927,15014,14150,13979,13800,13551,12016,12132,12083,12078,11703,12193,11754,
11887,14770,15013,15528,15499,13690,13771,13934,13939,15459,15446,14685,14581,14794,15002,14956,14699,
14463,14527,15118,14743,13231,13179,13749,13692,13286,13054,14130,13773,14772,14962,15420,15640,10222,
10230,10233,10234,11935,12003,12180,11727,15449,15650,15889,15884,13808,13981,13991,14036,12107,11645,
11230,11245,11761,12194,12085,11990,8023,8092,7902,7997,7151,7159,8133,8106,8052,7674,7917,8113,8134,79
23,8027,8108,12225,12136,11756,11895,11993,11964,11707,12005,14907,14801,15556,15501,15017,14582,15043 ,14686,15461,15507,15536,15502,12799,13276,14153,13941,13663,13779,13750,14049,14935,15004,15126,14796 ,15890,15681,15391,15560,13563,13774,13754,13753,13289,13239,13781,13559,13995,14154,14050,14211,12109 ,12184,11646,12086,12115,11994,11762,12144,14585,15018,15450,15905,13290,13181,13982,14095,13263,13182 ,14161,14132,14040,14240,14103,13679,14909,14747,15139,15125,14213,13942,13997,14156,12006,11709,11199 ,11251,10207,10236,10223,10231,15045,14701,14776,14964,13945,14023,13297,13243,13565,14003,14136,14214 ,15025,14710,14759,14802,15129,14586,14707,14817,15652,15682,15892,15623,11735,11899,12196,11951,12167 ,12089,11253,11135,15509,15462,15465,15664,14910,14749,14939,14702,14804,14991,15236,15141,13998,14052 ,14162,13687,15656,15523,15452,15407,13756,13782,13292,13298,11764,12110,12009,12090,11996,11710,12226 ,12200,13795,13727,13797,14217,15627,15745,15906,15684,14951,15020,15046,14765,15568,15746,15130,14588 ,11739,12117,12131,11901,12171,11751,11959,12010,7998,8079,8039,7807,8056,7647,7163,7165,8114,7918,8137 ,7676,8029,7925,8138,8087,12092,12017,12118,12121,11768,12063,11519,12228,14709,14941,15184,15026,1551
0,15513,15049,14968,14107,13785,13946,14056,14818,15142,14763,15240,14164,14272,13245,13271,14750,1455
9,15525,15466,14177,14005,14109,14218,14027,14119,13786,13948,14999,15028,15171,14955,15415,15688,1589
6,15937,8043,8030,7926,8116,8145,8091,8140,7929,8045,8120,7663,7871,8103,8146,8051,7930,12173,11983,117
41,12179,11246,11254,11902,12012,14808,14791,15132,15145,15908,15473,15514,15439,13246,13275,14006,135
66,14029,13887,13300,13287,15050,15057,15629,15468,15173,15052,15200,15146,14942,15248,15058,15032,159
38,15584,15526,15879,12208,12133,11755,11963,12018,12122,11742,12232,14713,14771,15153,14655,14957,151
48,14820,14766,15174,15003,15912,15555,15630,16001,15883,15635,11257,11258,11647,12174,12079,12240,121
34,12181,14824,14575,14714,14795,14958,14963,15940,15651,15419,15529,14773,14716,15154,14797,14832,150 05,14225,14110,14123,13691,14009,13743,13304,13055, 15015,15060, 15177,14965,13919,13801, 14178,14035,11991,11757,12137,11965,12195,12020,12124,11763,15920,15474,15637,15516,15447,15557,14687,14803,13798,142
20,14030,14125,13788,14168,14151,14037,14774,15073,14587,14798,14778,14777,15476,15530,14010,14226,132
77,13291,14064,14180,14131,14126,13751,14241,13802,13935,13983,14051,14228,13775,15421,15891,15885,160
02,15641,15638,15886,15537,11995,12087,12186,12138,12182,11766,12197,12007,14155,13693,13278,13293,138
09,14242,14133,14038,12024,12145,11758,11966,12185,11765,12140,12111,14805,14583,15019,15178,14273,141
84,13804,13943,14041,14012,13755,14053,15653,15748,15074,15235,15006,15119,15185,15156,15064,15264,151
27,14703,10235,10237,10238,10239,11231,11260,12256,11711,15237,14966,15451,15944,15021,15180,16129,155
58,7671,8093,8046,7903,8161,8053,8107,8162,8148,8094,7932,8109,8135,8054,7999,8115,14157,14232,13694,14
134,14163,14042,13810,14192,14054,13757,13247,13299,14969,15047,15532,15480,13783,13947,14244,13999,14
215,14137,13301,13183,13812,14158,14057,14138,14044,13758,14274,14248,11997,12091,12198,12146,12201,12
227,12011,11769,13787,14165,14179,13949,14219,13799,14007,14058,15561,15696,14589,15027,15422,15642,15
503,15463,15160,15238,15538,15654,15453,16004,15022,15076,12119,12188,11998,12093,11247,11255,12229,12
202,15186,14711,14780,14806,14819,14751,15562,15952,7166,7167,7675,8057,8152,7919,8110,8164,8139,8058,7
677,8117,8141,8168,8060,8118,12148,11770,12013,12209,12230,12019,12123,12204,15683,15752,14821,15241,1
5657,16130,15131,14809,15467,15540,15511,15569,15644,16008,15454,15564,14970,15080,15188,15296,14140,1
4065,14166,14169,15658,15760,15968,15712,15685,15893,15515,15570,15201,15029,15665,15907,15660,15469,1 5544,15894,15897,15475,15133,15242,15051,15143,15527,15585,12094,12175,12135,11903,12152,11743,11259,11261,13816,14111,13567,14276,15686,15666,14810,14972,15030,14590,15053,14911,15249,15134,16132,15517,16016,15689,15147,14715,15033,14767,14943,14825,15202,15059,14822,15244,14221,14031,13789,14227,13294,13302,13950,14060,14256,14181,13803,14011,12210,12014,12233,11772,12125,12021,12234,12183,14066,14170,13790,14280,13305,13306,13695,14222,14127,14288,14182,14229,15470,15477,15054,15149,14812,15192,15175,15061,14039,13805,14185,14013,15572,15531,16136,15690,15034,15250,15088,15204,15155,15150,14775,15265,15586,15909,14826,14959,12139,12126,12022,12212,12241,12187,12236,12025,15007,15075,15252,14799,15179,14717,14833,15266,15898,15747,15668,15576,15776,15631,15639,15518,15697,15910,16032,15478,15692,15939,15900,15749,14243,14068,14172,13811,15533,15481,15913,15559,12141,12216,11759,11967,12199,12242,12147,12026,15157,15062,16144,15539,14043,14135,14234,14186,15588,15698,15672,16064,15297,15208,15750,15534,11767,12189,12142,11999,12257,12149,12203,12258,14828,14967,15914,15941,15065,15036,14779,15077,15753,15643,15482,15808,14230,13814,14245,14055,8031,7927,8176,7678,8147,8121,7931,8142,8122,8047,8149,8150,8095,8163,7933,8124,15713,15921,15563,15423,14072,14193,13806,14014,12244,12190,12028,12205,12231,12150,12095,12211,15181,15256,14718,15158,14233,13813,14188,14159,15700,15754,15887,15942,15916,15541,15655,15645,13279,13308,14304,13759,15592,15484,15187,15066,14834,15216,15078,14781,14807,14971,15565,15542,14045,14139,14246,14194,16003,15922,15646,15945,15268,15023,15659,15714,15239,15161,14836,15182,15081,15162,15571,15761,15545,15756,15068,14782,11262,11263,11771,12153,12248,12015,12206,12260,15298,15272,14811,15189,15704,15946,15203,14973,15243,14823,16005,15953,15895,15600,15031,15082,14249,14275,14059,13817,15566,15455,15164,15089,14167,14236,14046,14141,15687,15924,15190,15193,8055,8153,8165,8154,8111 ,8059,8166,7934,7679,8156,8169,8119,8170,8061,8143,8062,16160,15762,15716,15667,15661,15777,14840,15135 ,14591,15300,15573,15928,13295,13303,14277,14250,16192,15948,15245,15055,14196,13818,14061,14257,12235 ,12154,11773,12213,12237,12264,12156,12214,14278,14067,14171,14252,15546,16006,15764,15587,16256,15954 ,14813,15251,14974,15084,15778,15662,16009,16131,15280,15205,14827,15035,15090,15194,14142,14223,14183 ,13951,15720,15899,14814,15304,14719,15246,15151,15312,15471,15691,15206,15253,14200,13791,13307,13309 ,15574,15669,15063,14829,15209,15037,15548,15809,15577,15768,15969,15956,14258,14062,14281,13820,15911 ,16010,15589,15519,15780,15670,15267,15092,15901,16133,15196,14835,14173,14069,14282,14231,15067,15159 ,15970,16017,15693,15479,15960,15699,14187,14174,14070,14260,12127,12023,12272,11774,12243,12217,12027 ,12238,8177,8123,8172,8178,8125,8151,8126,8155,8180,8167,8184,7935,8157,8171,8158,8173,14289,14235,14284,14073,15578,15728,16012,15590,15258,15210,15751,15673,15254,14838,15810,15902,15269,15079,15096,15217,15694,15593,15915,16134,12218,12143,12245,12246,12191,12259,12029,12220,14189,14264,13807,14015,15535,15483,16018,15972,14830,15038,15257,14837,15701,16137,15580,15674,15784,15755,16033,15943,14247,14290,14195,14074,15715,15647,15543,15594,15485,15917,16020,15976,13815,14237,14190,14047,15702,15676,15601,16138,15923,15705,15812,15757,15212,15183,15328,14783,15763,15567,15069,15163,14305,14197,14251,14306,16034,15918,16145,15792,15270,15218,15273,15299,15717,15547,15596,16024,15083,14841,15191,15260,15070,15165,15301,15274,15984,15947,16140,16065,14292,14238,14076,14253,15220,14842,15085,15281,14279,14198,14143,14259,15486,15602,15302,15091,15195,15276,15925,15758,15706,15816,15718,15765,13310,13311,13819,14201,15663,15929,15604,15955,12151,12249,12261,12250,12207,12155,12262,12030,15166,15247,15207,14975,15224,14815,15549,15926,15282,15086,15305,14844,15197,15093,15306,15255,14296,14063,14254,14308,15211,15198,15094,15284,16036,15721,16066,15949,15575,16146,16007,15708,14283,14202,13821,14261,15779,15766,15824,16040,11775,12252,12265,12215,12266,12157,12239,12158,14285,14312,14204,14262,16161,15722,15950,15769,15930,16148,15957,15932,15579,15671,15313,15259,16068,15958,15961,16011,15781,16152,16162,15971,15962,15770,15591,16048,14175,14071,14320,138

22,15308,15097,16013,15608,15729,15550,15724,16
014,1601
9,15695,15840,15675,15581,15730,15213,15288,148
31,15039,15271,15314,14291,14265,14075,14286,15
219,1509
8,14839,15261,15214,15071,15973,15782,15785,158
11,15329,15221,15974,15903,15595,15772,15703,15
732,1613
5,15677,14266,14191,14293,14294,15582,15786,158
13,15597,15919,16193,16164,16072,16194,16021,16
168,1613
9,15275,15330,15977,15964,14239,14307,14077,142
68,15793,16080,15316,15262,16176,16196,15707,16
257,1419
9,14297,14309,14298,15603,16022,15814,15678,160
35,15978,15100,15277,8127,8179,8181,8063,8174,81
82,8185,
8186,8159,8188,8175,8183,8187,8189,8190,8191,122
73,12219,12268,12274,12221,12247,12222,12251,16
258,161
41,15303,15222,14255,14203,14310,14078,15736,15
788,15167,15283,16025,16096,15927,16200,14843,1
5225,159
85,15598,15719,15817,15759,16147,15320,15087,15
951,16038,15794,16037,15709,15605,15818,16026,1
5980,157
23,13823,14300,14313,14263,15487,15551,16142,15
767,15796,15986,15931,15825,15278,15332,16041,1
5606,153
07,15226,16067,15710,12276,12263,12280,12031,12
253,12267,12254,12269,15959,16028,16150,15820,1
5609,160
42,14845,15285,15933,15771,15309,15336,14314,14
205,14287,14206,15228,15286,16163,16149,16069,1
5725,158
00,15988,16049,15734,15783,15826,15199,15095,16
153,15610,15731,15841,15934,15773,15344,14846,1
5963,157
26,15828,16015,16260,16165,15315,15289,15975,16
044,16070,15789,16154,15612,15099,15310,15733,1
5965,162
08,16050,15290,15215,14321,14267,14316,14322,12
223,12275,12277,12159,12270,12278,12281,12282,1
5317,153
18,16073,15992,15842,16166,15787,16264,15774,15
583,16023,16052,14269,14295,14270,14299,15263,1
5331,161
95,15979,15832,15815,16156,16169,16074,16081,15
101,15292,16197,16076,16224,16170,15223,15321,1
5966,162
72,16082,16056,15737,15795,16177,15679,15333,15
322,15981,16172,15844,15790,16198,16027,15848,1
5599,157
38,15819,15982,15987,15279,15227,15797,15740,15
334,15102,16178,15821,15856,16029,16039,16084,1
4847,153
24,16201,15989,14324,14311,14328,14079,15711,15
827,15798,16097,15611,15822,15802,15801,15337,1
5287,158
29,15607,16043,16202,16098,16259,15338,15229,16
030,16143,14301,14315,14302,14317,15311,15230,1
6209,161
80,16088,16288,16151,15727,16261,15990,16045,16
204,15993,16071,15345,15291,15613,16051,16184,1
6262,160
46,16100,16210,15735,15804,15830,15340,15346,15
843,15775,15845,16265,16155,15833,15994,16104,1
6212,163
20,15293,15319,16225,16053,16157,16266,16075,16
167,15834,15996,15294,15323,16054,15614,16077,1
5935,153
48,15335,16273,16158,16171,15739,12255,12284,12
271,12279,12283,12285,12286,12287,14271,14323,1
4325,142
07,16057,15791,15352,15103,15967,15849,16226,16
083,15846,16268,16078,16173,15836,16216,16199,1
6085,160
58,16274,15325,15339,16112,16228,16179,16174,15
799,16289,15850,15983,14318,14326,14329,14330,1
6031,160
99,16276,15823,16203,15741,15326,15341,15857,16
290,16181,16086,16321,16232,15852,15991,16089,1
6060,158
03,16101,16205,16280,15742,16182,16211,16090,15
858,16240,16102,15805,15295,15347,14303,14332,1
4319,143
27,15831,15995,16292,16047,16263,16185,15349,15
231,15860,16206,16105,16186,16092,15806,16322,1
6296,158
35,16213,16227,15997,16267,15847,16055,16106,16
188,16113,16214,16217,15864,16159,15615,16324,1
6269,160
79,15837,16275,15342,15350,15998,16108,16304,16
229,15851,16059,16114,16218,15838,16328,15353,1
5354,157
43,16270,16175,16336,16230,16277,16087,15853,16
233,16061,16291,16116,16220,15859,16091,16183,1
6282,162
34,16278,15862,16293,16103,16120,16241,15854,16
062,16281,15861,16236,16207,14331,14333,14334,1
4335,153
27,15356,16352,15807,16093,16187,16294,16242,16
297,16323,16107,15865,16215,16284,16094,16189,1
5343,153
51,16325,16298,16244,15866,16109,16305,16326,16
115,16219,16300,16190,16271,16231,15999,16248,1
5839,153
55,15357,16306,16110,16329,15868,16221,16117,16
330,16279,16235,16222,16118,16308,16337,16283,1
6332,161
21,16237,16312,15855,16063,16295,16338,16243,16
122,15863,16285,16238,16095,16353,16245,16299,1
6354,163
40,16286,16124,16301,16327,16246,16191,16307,15
358,15359,15867,16249,16344,16111,16302,16356,1
6331,162

50,15869,16309,16333,16360,16252,16310,16223,16119,16368,15870,16339,16313,16123,16334,16314,16239,16341,16342,16287,16355,16125,16316,16247,16345,16357,16346,16303,16251,16358,16126,15871,16348,16361,16311,16362,16253,16335,16254,16369,16315,16364,16370,16317,16343,16318,16347,16372,16359,16376,16127,16349,16363,16350,16365,16319,16371,16373,16255,16366,16374,16377,16378,16351,16380,16367,16375,16379,163 81,16382,16383]

**Sequence group 1: ZI_16384**

[0,1,2,7,3,8,11,24,4,10,13,28,16,33,35,78,5,12,14,32,19,38,47,82,22,46,42,91,59,99,107,182,6,17,21,40,23,45,51,93,29,57,61,100,73,118,123,197,34,63,76,121,81,132,147,214,90,149,159,252,164,264,298,425,9,18,26,56 ,30,60,72,113,36,77,64,126,85,137,153,229,44,75,89,148,95,156,163,260,103,166,184,288,196,306,322,505,53,92,101,162,119,176,191,303,130,192,213,314,231,335,362,560,151,227,255,343,262,363,385,605,295,391,412,625,457,648,708,996,15,25,31,74,39,80,83,152,48,88,96,161,106,171,179,302,58,97,112,177,122,190,206,318,136,207,228,330,257,357,381,593,66,116,131,195,140,212,236,352,160,253,263,365,294,390,403,624,178,275,304,395,315,431,459,646,340,478,524,681,576,728,793,997,70,133,155,239,170,261,291,393,183,296,308,424,323,458,504,665,202,319,331,472,364,520,562,736,375,582,608,764,636,806,850,1201,233,353,368,527,396,592,611,786,456,621,647,826,686,853,937,1277,495,656,709,892,726,991,1021,1353,791,1068,1133,1330,1183,1398,1521,1976,20,37,41,94,49,98,114,189,50,115,127,198,144,230,242,379,65,128,145,245,157,256,273,380,165,272,299,407,320,455,462,645,68,154,167,247,186,280,305,454,194,312,324,466,334,514,545,724,193,332,355,513,374,563,595,765,398,613,637,805,655,849,901,1259,79,181,187,310,201,328,354,506,215,359,367,561,386,604,620,797,297,382,397,607,426,630,654,828,484,661,714,886,747,990,1023,1310,327,414,467,644,512,680,718,958,550,731,757,995,794,1093,1155,1375,609,792,807,1134,829,1184,1121,1433,914,1256,1278,1531,1291,1609,1734,2044,84,199,203,373,281,389,402,612,311,406,427,639,479,663,711,976,325,473,511,664,526,719,749,999,583,759,783,1089,827,1153,1200,1437,378,515,544,748,594,778,813,1122,638,814,851,1194,915,1179,1263,1545,671,882,980,1257,1008,1290,1328,1594 ,1094,1341,1340,1706,1434,1823,1863,2291,413,577,616,815,662,852,900,1217,715,959,992,1279,1059,1293,1331 ,1607,750,1017,1123,1311,1156,1352,1435,1824,1216,1455,1518,1866,1564,1994,2042,2433,804,1135,1192,1436,1262,1450,1550,1889,1276,1547,1602,2020,1688,2087,2208,2644,1294,1610,1820,2143,1854,2211,2165,2650,1958,2329,2357,2876,2439,2958,3157,3636,27,43,52,102,62,129,146,237,67,150,158,244,169,266,274,428,69,168,180,265,188,329,341,494,224,342,372,551,388,596,617,825,71,185,200,333,226,369,383,590,238,392,404,622,430,649,669,854,254,415,461,660,507,710,729,926,521,725,760,1016,763,1088,1152,1523,117,225,232,387,246,405,429,641,289,463,485,705,523,735,758,978,309,491,529,727,589,762,771,1056,606,772,782,1154,881,1185,1244,1546,326 ,588,598,781,629,812,824,1176,651,880,903,1211,994,1260,1280,1603,704,936,1009,1281,1095,1299,1385,1689,1191,1392,1464,1825,1519,1871,1996,2399,120,243,267,460,307,490,525,746,321,546,591,773,610,790,795,1157,358,599,628,796,650,877,893,1208,687,924,993,1265,1057,1295,1364,1604,384,640,668,902,730,981,979,1296,751,1020,1069,1354,1177,1388,1430,1833,787,1120,1187,1399,1209,1493,1520,1906,1247,1544,1588,2021,1705,2089,2209,2645,399,707,734,1022,770,1092,1178,1393,863,1190,1228,1508,1241,1522,1562,1987,883,1229,1246,1549,1297,1567,1669,2086,1372,1704,1779,2144,1862,2294,2332,2677,925,1329,1358,1605,1431,1707,1822,2177,1465,1856,1907,2328,1997,2358,2437,2905,1590,1915,2022,2363,2135,2457,2482,3121,2178,2573,2649,3320,2838,3406,3601,4103,141,290,313,547,356,597,623,848,366,631,657,879,706,913,998,1365,394,670,737,977,761,1091,1058 ,1374,779,1132,1182,1454,1218,1502,1525,1959,510,756,780,1090,862,1159,1193,1509,878,1219,1243,1530,1261,1563,1593,2046,884,1258,1292,1592,1367,1668,1735,2145,1408,1853,1857,2295,1914,2333,2396,2870,522,855,876,1210,885,1240,1264,1566,927,1298,1355,1608,1389,1732,1855,2289,1186,1366,1432,1778,1466,1867,1918,2330 ,1565,1919,2023,2364,2142,2456,2481,3120,1242,1492,1548,1870,1591,2019,2082,2398,1677,2088,2161,2480,2288,2642,2676,3327,1821,2179,2301,2648,2356,2687,2867,3412,2432,2877,2949,3565,2964,3701,3705,4335,528,887 ,912,1359,1158,1384,1409,1852,1195,1451,
1503,1888,1551,1986,2045,2397,1245,1524,1589,199
5,1606,2083,2164 ,2459,1733,2210,2160,2527,2331,2
651,2819,3388,1373,1595,1611,2134,1832,2176,2300
,2646,1865,2302,2335,281
2,2365,2839,2932,3564,2018,2359,2436,2871,2483,2
959,2965,3657,2643,3181,3326,3759,3407,3882,3968
,4322,14
67,1676,1864,2303,1977,2334,2362,2866,2043,2438,
2458,2948,2572,2962,3321,3704,2047,2526,2647,318
0,2818,3
328,3329,3883,2904,3413,3427,3969,3637,4178,4234
,5080,2290,2686,2813,3389,2933,3426,3600,3975,29
63,3656,
3700,4179,3838,4235,4680,5244,3156,3758,3839,432
3,3974,4334,4681,5245,4102,4692,4693,5514,5081,5
515,615
2,6153,54,55,86,125,87,134,139,292,104,138,143,316
,234,339,361,618,105,142,204,338,241,376,453,642,2
82,452,
448,667,489,717,745,1062,124,235,259,400,283,451,
475,683,317,487,493,732,579,776,789,1163,360,509,
614,785,
627,830,889,1212,666,891,957,1288,1010,1344,1404,
1731,135,240,300,486,336,492,578,767,370,615,530,
798,653,
857,939,1227,450,581,659,890,685,950,989,1308,739
,1012,1070,1386,1162,1428,1462,1913,477,682,733,9
88,777,
1024,1149,1407,810,1150,1203,1456,1231,1497,1560
,2080,895,1225,1305,1501,1342,1561,1659,2149,139
5,1665,1
710,2197,1777,2260,2360,2924,205,293,337,580,377,
626,643,938,464,658,712,983,744,1019,1027,1406,48
8,713,7
66,1025,788,1148,1188,1458,856,1189,1226,1482,13
07,1527,1631,2131,532,774,811,1161,858,1202,1250,
1510,98
2,1289,1343,1585,1394,1664,1679,2196,1026,1351,1
410,1671,1457,1757,1827,2258,1498,1860,1988,2305
,2090,24
34,2593,2925,548,831,949,1267,1018,1309,1391,166
7,1063,1396,1438,1730,1463,1826,1912,2293,1180,1
459,1483 ,1858,1584,1978,2084,2492,1615,2092,215
6,2524,2214,2640,2760,3385,1249,1511,1600,1991,1
672,2130,2159,256
2,1776,2193,2259,2706,2306,2763,2879,3479,1905,2
266,2361,2824,2374,2911,2935,3659,2575,2956,3123
,3652,32
39,3760,3971,4570,258,371,401,684,465,716,768,114
7,474,769,799,1164,860,1230,1268,1629,531,808,861
,1271,9
51,1306,1349,1630,1011,1348,1405,1709,1460,1759,
1830,2257,534,948,1013,1283,1144,1356,1411,1758,
1160,145
2,1476,1834,1496,1956,1999,2372,1151,1494,1517,1
955,1614,2085,2133,2525,1674,2163,2215,2639,2265
,2711,28
27,3425,619,1061,1145,1448,1167,1480,1516,1916,1
213,1529,1587,2081,1660,2148,2192,2637,1397,1656
,1673,21
51,1752,2212,2264,2708,1868,2269,2368,2822,2495,
2910,2951,3640,1479,1728,1835,2256,1954,2304,237
0,2900,2
040,2485,2509,2923,2594,3081,3159,3711,2157,2592
,2641,3152,2709,3322,3097,3823,2868,3422,3484,40
99,3567,
4233,4314,4694,652,1165,1181,1613,1357,1663,1678
,2162,1449,1708,1753,2233,1861,2271,2367,2902,14
77,1859,
1953,2292,1990,2371,2505,2927,2093,2511,2561,296
1,2707,3155,3384,3841,1628,1957,1998,2504,2132,2
552,267
9,3098,2232,2684,2761,3346,2869,3237,3463,4101,2
299,2816,2908,3423,2928,3566,3642,4184,3082,3655
,3654,42
50,3836,4321,4373,5083,1711,2091,2166,2685,2270,
2762,2826,3393,2369,2901,2920,3485,2955,3603,365
3,4191,2
506,2931,3099,3641,3176,3658,3837,4328,3392,3873
,3910,4416,4124,4678,4690,5513,2638,3153,3344,38
40,3462,
3842,4120,4421,3478,4109,4186,4686,4246,4733,506
2,5786,3620,4236,4318,4987,4368,5069,5037,5832,4
568,519
5,5253,6154,5563,6218,6335,7012,301,449,476,738,5
08,809,888,1251,533,894,956,1270,1015,1346,1350,1
754,535 ,1014,1060,1345,1146,1481,1499,1904,1214,
1500,1612,2041,1662,2140,2167,2705,549,1071,1166
,1495,1224,1601 ,1657,2128,1266,1666,1690,2194,17
56,2261,2297,2780,1304,1729,1829,2268,1917,2366,
2435,2874,1979,2373,252
0,2930,2523,2960,3154,3973,775,1215,1248,1661,12
82,1691,1755,2235,1387,1831,1869,2337,1985,2487,
2510,290
6,1439,1891,1993,2375,2095,2522,2545,2952,2150,2
546,2560,3158,2815,3323,3414,4108,1478,2094,2146
,2555,21
99,2678,2704,3182,2263,2814,2837,3391,2922,3460,
3486,4187,2336,2878,2929,3487,3083,3639,3749,424
7,3331,3
756,3874,4329,3911,4419,4682,5475,784,1269,1347,
1828,1429,1890,1989,2494,1461,2016,2129,2547,215
8,2574,2
595,3177,1528,2147,2198,2636,2262,2793,2825,3386
,2307,2872,2921,3477,2953,3621,3702,4188,1658,22
34,2296,
2836,2484,2909,2907,3622,2507,2934,2957,3660,318
3,3750,3820,4331,2563,3096,3325,3761,3387,3905,3
970,442
2,3421,4100,4176,4687,4249,4735,5063,5787,1675,2
339,2486,2950,2544,3080,3236,3757,2783,3330,3404
,3908,34
09,3972,4122,4677,2817,3405,3420,4111,3623,4127,
4239,4732,3708,4248,4317,4996,4372,5136,5226,583
5,2873,3

643,3662,4189,3821,4251,4320,5039,3875,4370,4423
,5194,4683,5254,5561,6193,4180,4509,4688,5257,49
85,5681,
5694,6333,5060,5699,5823,6494,6042,6690,6895,773
1,859,1390,1453,2017,1526,2141,2195,2710,1586,22
13,2267,
2795,2338,2865,2926,3703,1670,2298,2493,2903,252
1,2967,2954,3710,2553,3122,3238,3872,3394,3906,4
097,456
9,1952,2508,2554,2966,2782,3179,3345,3909,2794,3
395,3411,4098,3461,4123,4183,4712,2820,3424,3602
,4182,37
07,4238,4315,4997,3762,4333,4371,5137,4508,5227,
5472,6082,1984,2781,2792,3390,2821,3408,3476,412
6,2875,3
638,3661,4232,3751,4312,4369,5071,3324,3706,3822
,4316,3880,4417,4510,5224,4125,4511,4689,5258,49
86,5680,
5693,6332,3410,3904,4110,4418,4181,4685,4714,547
4,4245,4734,4999,5692,5070,5784,5834,6581,4319,5
061,513
9,5822,5252,5861,6081,6700,5512,6155,6217,6893,6
226,7093,7095,8307,1992,2823,2864,3663,3178,3748
,3763,43
32,3347,3843,3907,4420,4121,4676,4695,5473,3415,
4096,4177,4679,4190,4715,5036,5683,4313,5068,499
8,5697,5
225,5833,6041,6688,3709,4185,4237,4984,4330,5038
,5138,5820,4375,5192,5247,5862,5259,6043,6194,68
92,4684,
5255,5560,6083,5695,6219,6227,7015,5785,6493,658
0,7237,6691,7260,7262,8304,3881,4244,4374,5193,4
571,524
6,5256,6080,4691,5562,5682,6216,5698,6224,6495,7
094,4713,5696,5821,6492,6040,6582,6583,7261,6192
,6701,67
03,7263,7013,7752,7754,8884,5082,5860,5863,6689,
6195,6702,6894,7729,6225,7014,7092,7753,7238,775
5,8536,8
886,6334,7236,7239,8305,7728,8306,8537,8887,7730
,8538,8539,9680,8885,9681,9682,9683,108,109,110,1
75,111,
208,211,284,172,210,249,408,268,469,471,754,173,2
48,250,468,271,482,567,802,278,566,518,871,635,89
9,923,13
02,174,269,277,516,279,565,587,873,409,633,673,91
6,741,946,955,1369,470,675,752,953,801,1032,1127,
1426,870 ,1129,1207,1532,1252,1596,1686,2181,209,
270,286,632,410,672,740,941,480,753,676,986,865,1
037,1197,1473,56
4,743,869,1128,875,1204,1223,1556,919,1254,1332,1
624,1368,1782,1838,2353,601,872,917,1222,947,128
4,1339,1
695,1030,1360,1425,1806,1475,1899,1962,2488,1131
,1471,1535,1911,1558,1963,2077,2589,1683,2099,21
52,2681,
2229,2728,2808,3560,251,285,411,742,483,800,803,1
196,584,868,896,1221,922,1275,1287,1694,634,897,9
40,1285 ,954,1338,1414,1818,1036,1415,1472,1894,1
553,1925,2073,2569,678,944,1031,1363,1064,1424,1
488,1920,1220,1
533,1559,1965,1682,2098,2111,2680,1286,1619,1780
,2103,1807,2203,2231,2702,1908,2310,2460,2773,25
48,2912,
3089,3561,722,1033,1199,1491,1274,1557,1627,2101
,1303,1684,1800,2180,1839,2230,2352,2765,1402,18
19,1895,
2276,1964,2392,2490,2944,2067,2558,2596,3056,269
2,3102,3174,3885,1485,1921,1980,2463,2104,2568,2
599,307
8,2228,2673,2703,3166,2778,3217,3417,4049,2343,2
736,2809,3340,2898,3555,3629,4241,3087,3696,3769
,4130,38
55,4426,4609,5240,276,481,517,874,585,898,942,133
7,586,943,987,1370,1124,1474,1506,2071,677,1028,1
125,151
3,1205,1552,1617,2072,1253,1616,1687,2139,1836,2
227,2238,2701,720,1198,1255,1515,1334,1620,1781,
2226,136
2,1804,1848,2274,1898,2390,2473,2896,1361,1896,1
923,2389,2066,2491,2571,3057,2106,2633,2693,3101
,2735,31
73,3349,4035,755,1301,1335,1802,1401,1892,1922,2
354,1427,1927,1967,2489,2078,2588,2672,3093,1685
,2074,21
05,2591,2182,2690,2734,3168,2312,2741,2830,3334,
2971,3554,3631,4118,1851,2154,2275,2700,2388,277
2,2834,3
458,2478,2915,3001,3559,3090,3753,3815,4263,2597
,3088,3103,3770,3169,3864,3765,4465,3398,4032,40
50,4667,
4059,4885,5066,5504,864,1371,1403,2065,1621,2097
,2110,2632,1803,2138,2183,2695,2311,2743,2811,34
72,1849,
2277,2387,2764,2462,2835,2973,3563,2559,3003,307
5,3745,3167,3813,3884,4469,2070,2391,2472,2972,2
570,307
0,3161,3766,2694,3162,3175,3878,3399,3851,4039,4
669,2771,3234,3480,4033,3604,4058,4128,4778,3754
,4133,41
32,5014,4466,5131,5175,5855,2153,2549,2652,3163,
2742,3216,3348,3945,2831,3459,3556,4051,3647,406
1,4131,4
883,2974,3625,3767,4119,3816,4240,4467,5132,3944
,4479,4574,5178,4728,5394,5478,6165,3100,3771,38
76,4468,
4038,4474,4674,5185,4048,4671,4782,5428,5008,551
9,5792,6488,4062,4886,5128,5615,5150,5795,5733,6
498,523
8,5965,6045,6928,6187,7038,7125,7724,287,519,600,
918,674,1029,1126,1489,679,1130,1206,1512,1273,1
598,161
8,2200,721,1272,1300,1597,1336,1893,1909,2342,14
68,1910,2064,2479,2096,2584,2653,3165,723,1333,1
400,1897 ,1470,1981,2075,2566,1490,2100,2136,267
4,2202,2729,2769,3218,1534,2155,2237,2740,2355,2

810,2913,3402,239
3,2897,3004,3624,3007,3744,3812,4611,945,1469,14
84,2079,1514,2137,2201,2697,1625,2239,2313,2797,
2395,291
9,3002,3474,1801,2319,2465,2899,2565,3006,3063,3
644,2590,3064,3074,3814,3233,3865,4016,4670,1850
,2564,25
86,3073,2689,3160,3164,3848,2731,3232,3351,3939,
3558,4036,4052,4783,2796,3416,3605,4053,3755,410
7,4265,5
009,3871,4324,4504,5133,4575,5183,5396,6163,952,
1507,1599,2236,1783,2318,2461,2970,1837,2474,256
7,3065,2
598,3086,3091,3817,1926,2587,2688,3092,2730,3229
,3341,3936,2779,3400,3557,4041,3645,4063,4256,48
80,2076,
2696,2768,3350,2914,3481,3475,4104,2975,3628,369
7,4242,3849,4268,4446,5145,3079,3764,3867,4427,3
937,452
9,4608,5190,4019,4668,4772,5429,5013,5553,5793,6
489,2107,2799,2918,3630,3062,3752,3850,4325,3227
,3870,39
76,4548,3981,4610,4718,5251,3235,3977,4018,4673,
4105,4731,4993,5518,4260,5012,5087,5684,5174,585
8,5976,6
501,3401,4129,4254,4881,4447,5015,5130,5777,4505
,5168,5191,5964,5397,6046,6185,6937,4774,5199,54
30,6087,
5611,6189,6198,7117,5778,6337,6497,7228,6886,727
4,7605,8311,1065,1626,1805,2475,1924,2585,2675,3
172,196
6,2691,2737,3231,2798,3397,3562,4257,2102,2770,2
945,3473,3005,3747,3646,4262,3071,3768,3854,4478
,3946,45
46,4613,5239,2386,3000,3072,3746,3226,3819,3877,
4549,3230,3947,3983,4666,4037,4719,4777,5506,333
2,4034,4
060,4776,4259,4992,5067,5685,4440,5149,5169,5859
,5198,5977,6160,6906,2394,3219,3228,3938,3333,39
80,4040,
4730,3403,4106,4243,4884,4269,5064,5151,5853,386
6,4258,4464,5086,4506,5179,5230,5966,4729,5231,5
431,612
0,5614,6188,6197,7116,3982,4528,4672,5182,4775,5
427,5510,6162,5005,5552,5729,6196,5852,6462,6500
,7235,51
29,5779,5933,6496,6044,6563,6891,7360,6164,6929,
7029,7601,7096,7749,7757,8983,2464,3335,3396,425
5,3818,4
264,4441,5148,3879,4475,4547,5184,4675,5250,5505
,6161,4017,4612,4773,5395,4882,5511,5732,6191,50
65,5794,
5728,6239,5967,6499,6695,7264,4261,4779,4887,561
0,5144,5776,5932,6490,5177,5934,5979,6604,6121,6
887,702
4,7600,5426,6047,6184,6907,6199,7039,7097,7741,6
463,7221,7234,7835,7275,8250,8268,8882,4507,5004
,5176,59
35,5241,5978,6086,6890,5479,6186,6190,7028,6336,
7090,7229,7756,5507,6238,6491,7220,6694,7248,724
9,8251,6
936,7361,7371,8269,7725,8470,8554,9684,5854,6562
,6605,7265,7025,7370,7604,8283,7091,7740,7748,84
71,8150,
8555,9236,9812,7124,7834,8151,8883,8282,8982,923
7,9813,8310,9328,9329,9918,9685,9919,10728,10729
,602,60
3,866,985,867,1034,1039,1680,920,1038,1067,1816,1
486,1903,1961,2654,921,1066,1412,1902,1505,2068,
2225,26
98,1622,2224,2204,2767,2317,2833,2969,3650,984,1
487,1555,2108,1623,2207,2279,2775,1817,2315,2341
,2916,25
51,3068,3085,3835,1960,2385,2634,3077,2683,3170,
3337,3940,2766,3339,3457,4056,3606,4192,4428,505
9,1035,1
504,1692,2314,1900,2340,2550,3059,1982,2635,2466
,3094,2733,3221,3419,3951,2206,2557,2739,3338,27
77,3430,
3553,4116,2947,3616,3698,4266,3834,4444,4502,519
7,2309,2774,2917,3552,3069,3632,3809,4431,3126,3
810,388
7,4496,3979,4533,4716,5508,3343,3949,4113,4545,4
134,4717,4947,5689,4327,4989,5034,5789,5085,5828
,6084,70
16,1413,1681,1901,2556,2069,2682,2699,3418,2272,
2738,2828,3483,2968,3627,3635,4430,2316,2829,305
8,3633,3
084,3808,3868,4498,3220,3869,3950,4518,4115,4615
,4927,5567,2468,3066,3127,3833,3222,3886,4022,45
50,3482,
4057,4135,4769,4326,4988,5007,5788,3634,4199,444
2,4995,4497,5077,5135,5826,4534,5172,5260,5961,5
554,616
6,6341,7017,2476,3171,3429,4043,3626,4117,4271,4
991,3651,4424,4470,5058,4503,5134,5196,5857,3852
,4499,45
19,5170,4768,5242,5516,6204,4923,5556,5700,6236,
5798,6460,6592,7257,4021,4551,4780,5263,5000,556
6,5703,6
330,5084,5781,5827,6566,5962,6595,6931,7483,5189
,5838,6085,6880,6158,6943,7027,7743,6339,7036,71
19,7736,
7227,7836,8271,9126,1554,1983,2109,2776,2273,283
2,3060,3775,2278,3061,3095,3844,3224,3978,4044,4
925,246
7,3124,3225,4047,3431,4114,4197,4926,3607,4196,4
429,5033,4500,5079,5142,5825,2470,3428,3617,4055
,3772,42
52,4443,5078,3832,4476,4512,5146,4532,5236,5399,
6156,3811,4530,4573,5235,4922,5517,5609,6237,500
2,5731,5
799,6459,5837,6579,6883,7369,2655,3649,3773,4472
,3847,4516,4572,5228,3941,4665,4771,5509,4948,56
88,5780,
6457,4425,4944,5001,5691,5072,5796,5836,6576,518

0,5849,6124,6698,6207,6942,7031,7732,4515,5056,5147,5824,5234,5960,6126,6932,5476,6201,6229,7011,6342,7101,7127,7795,5701,6340,6461,7120,6577,7230,7113,8147,6904,7366,7484,8287,7603,8553,8834,9330,2732,3845,3853,4921,4253,4951,5006,5730,4473,5032,5073,5817,5173,5851,6123,6934,4513,5171,5233,5856,5262,6127,6221,7019,5557,6231,6329,7089,6567,7123,7256,8169,4924,5237,5398,6220,5608,6316,6503,7114,5816,6560,6593,7254,6905,7225,7375,8309,5931,6692,6940,7367,7020,7602,7734,8500,7102,7739,7738,8566,8148,8881,9093,9687,5035,5555,5734,6561,5850,6594,6882,7269,6125,6933,7008,7485,7035,7607,7737,8543,6222,7023,7115,7733,7216,7742,8149,8976,7268,8173,8266,9112,8464,9234,9310,9917,6458,7121,7252,8168,7374,8170,8356,9117,7482,8353,8502,9306,8562,9385,9570,10338,7720,8556,8838,9391,9088,9573,9557,10360,9124,9767,9825,10730,10075,10826,11019,11600,1693,2205,2308,2946,2384,3125,3336,4023,2469,3342,3456,4046,3619,4194,4198,5074,2471,3618,3648,4193,3774,4517,4535,5188,3942,4544,4920,5477,4950,5612,5735,6565,2477,3699,3846,4531,3948,4781,4945,5564,4042,4990,5010,5782,5076,5829,5929,6596,4112,5057,5141,5848,5229,6122,6167,6910,5243,6157,6232,7022,6235,7088,7122,8281,3067,3943,4020,4949,4054,5011,5075,5819,4267,5143,5181,5981,5249,6203,6230,6938,4471,5187,5393,6159,5559,6234,6313,7032,5690,6314,6328,7126,6607,7231,7362,8352,4514,5558,5686,6319,5791,6502,6564,7222,5831,6606,6885,7267,7010,7372,7486,8503,5980,6930,7021,7487,7103,7727,7797,8563,7251,7832,8174,8977,8267,9115,9238,9915,3076,4045,4195,5140,4445,5186,5261,6206,4501,5424,5565,6315,5702,6338,6343,7217,4664,5687,5790,6456,5830,6601,6881,7258,5963,6908,7009,7481,7033,7721,7750,8540,4946,5818,5928,6884,6200,6941,6939,7722,6223,7026,7037,7744,7223,7798,8144,8979,6331,7112,7233,7837,7259,8253,8270,9118,7365,8308,8468,9307,8565,9387,9571,10339,5003,5983,6202,7030,6312,7100,7224,7833,6599,7250,7272,8264,7277,8280,8358,9233,6693,7273,7364,8355,7723,8467,8559,9384,7792,8564,8837,9552,9092,9760,9810,10363,6909,7735,7746,8541,8145,8567,8880,9559,8175,9090,9119,9766,9239,9826,10073,10733,8496,9121,9308,9829,9389,10077,10218,11017,9568,10223,10343,11022,10586,11070,11559,12435,3223,4270,4477,5425,4614,5613,5783,6578,4770,5797,5839,6603,5982,6889,7018,7751,4994,5930,6205,6935,6233,7099,7034,7794,6317,7118,7226,8172,7270,8254,8285,9125,5232,6228,6318,7098,6598,7219,7253,8265,6602,7271,7279,8286,7373,8359,8499,9332,6696,7368,7606,8498,7759,8558,8835,9553,7838,8981,9091,9761,9120,9811,9912,10590,5248,6597,6600,7266,6697,7276,7480,8466,6911,7726,7745,8552,7799,8832,9089,9575,7232,7758,8146,8836,8248,9113,9122,9808,8465,9123,9309,9830,9390,10076,10217,11016,7278,8252,8354,9114,8497,9305,9334,9914,8561,9386,9555,10216,9574,10336,10362,11065,8839,9569,9763,10342,9824,10365,10589,11552,9916,10731,10825,11557,10830,11605,11607,12651,5392,6699,6888,7747,7218,7796,7839,8980,7255,8171,8255,9116,8357,9232,9331,9913,7363,8284,8469,9235,8542,9335,9556,10079,8833,9572,9554,10221,9809,10361,10585,11068,7793,8501,8557,9388,8978,9558,9762,10340,9095,9764,9815,10366,9831,10587,10734,11556,9304,9827 ,10072,10591,10219,10827,10831,11603,10337,11021,11064,12097,11071,12100,12102,12648,8249,8560,9094,9765,9127,9814,9828,10588,9311,10074,10078,10824,10222,10828,11023,11606,9333,10220,10341,11020,10584,11066,11067,12101,10732,11553,11555,12103,11601,12436,12438,13344,9686,10364,10367,11069,10735,11554,11558,12433,10829,11602,11604,12437,12098,12439,12652,13346,11018,12096,12099,12649,12432,12650,12653,13347,12434,12654,12655,13348,13345,13349,13350,13351,216,217,218,223,219,344,347,496,220,346,349,500,416,537,539,934,221,348,350,536,419,542,559,1002,422,558,554,1099,819,1139,1171,1646,222,417,421,552,423,557,571,1101,501,817,821,1140,929,1238,1315,1701,538,823,932,1313,1001,1324,1419,1750,1098,1421,1447,1844,1540,1936,2034,2625,345,418,498,816,502,820,928,1233,540,933,904,1318,1005,1377,1441,1789,556,931,1097,1420,1103,1444,1539,1932,1143,1542,1648,2024,1700,2170,2218,2841,573,1100,1141,1538,1239,1640,1655,2039,1322,1696,1749,2186,1791,2287,2378,2984,1423,1787,1847,2327,1934,2379,2497,3133,2031,2503,2604,3289,2721,3376,3492,4300,351,497,503,930,543,1000,1003,1440,568,1096,1136,1537,1170,1635,1643,2038,818,1137,1232,1641,1314,1654,1742,2190,1376,1743,1788,2282,1929,2349,2453,3113,906,1236,1323,1699,1380,1748,1796,2344,1536,1845,1935,2381,2030,2502,2579,3288,1642,1947,2168,2515,2187,2631,2723,3358,2324,2758,2892,3465,2992,3576,3793,4301,910,1325,1443,1799,1634,1933,2027,2513,1647,2032,2172,2624,2219,2722,2840,3441,1738,2191,2283,2752,2380,2888,2986,3608,2447,2998,3240,3732,3316,3806,3914,4697,1793,2345,2440,2895,2516,3112,3243,3786,2720,3285,3359,3858,3470,3917,4145,4829,2807,3432,3493,4028,3574,4295,4381,4977,3791,4412,4541,4906,4607,5158,5409,6208,420,541,553,1102,569,1138,1234,1653,570,1235,1319,1702,1416,1790,1810,2451,905,1320,1417,1813,1445,1928,1945,2452,1541,1944,2035,2583,2216,2719,2726,3357,908,1442,1543,1815,1650,1968,2169,2718,1698,2184,2220,2746,2286,2882,2977,3572,1697,2284,2347,2881,2446,2987,3115,3733,2518,3245,3317,3805,3383,3913,4069,4763,935,1645,1651,2174,1737,2280,2346,2842,1751,2351,2383,2985,2498,3132,3284,3797,2033,2454,2517,3135,2626,3294,3382,3860,2788,3437,3498,4014,3715,4294,4383,4902,2223,2606,2747,3356,2880,3464,3502,4206,2982,3579,3725,4299,3794,4437,4563,5031,3241,3792,3807,4542,3861,4616,4521,5273,4074,4760,4830,5419,4843,5569,5806,6356,1004,1703,1739,2445,1969,2501,2578,3244,2175,2582,2627,3319,2759,3439,3495,4224,2221,2753,2847,3440,2894,3503,3717,4303,2999,3727,3783,4433,3859,4561,4696,5277,2450,2883,2976,3716,3114,3778,3829,4522,3318,3830,3915,4658,4075,4603,4767,5433,3447,4010,4228,4761,4304,4842,4904,5538,4438,4917,4916,5738,5274,5927,6031,6787,2605,2993,3280,3831,3438,3916,4068,4721,3499,4207,4296,4831,4403,4845,4907,5551,3718,4377,4523,4903,4564,4976,5275,5952,4720,5335,5406,6034,5524,6322,6354,6945,3804,4543,4656,5276,4766,5330,5438,6089,4828,5435,5546,6348,5720,6447,6640,7428,4846,5570,5924,6527,6022,6643,6573,7434,6174,6817,6837,7716,6951,8006,8205,8740,499,555,572,1142,822,1321,1418,1797,907,1422,1446,1812,1633,1938,1946,2628,909,1632,1644,1937,1652,2281,2325,2806,1784,2326,2444,2983,2500,3116,3281,3857,911,1649,1736,2285,1786,2441,2455,3110,1798,2512,2580,3286,2630,3377,3445,3918,1846,2607,2725,3436,2843,3494,3577,4142,2889,3573,3728,4376,3731,4432,4560,5411,1237,1785,1792,2499,1814,2581,2629,3353,2025,2727,2789,3489,2891,3583,3726,4226,2173,2803,2937,3575,3109,3730,3739,4400,3134,3740,3782,4562,4009,4617,4748,5434,2222,3108,3118,3781,3293,3828,3856,4600,3379,4008,4071,4707,4298,4764,4832,5547,3488,4144,4305,4833,4439,4891,5121,5721,4623,5152,5344,5953,5407,6039,6324,6927,1312,1811,1939,2724,2171,2802,2893,3714,2217,2978,3111,3741,3242,3790,3795,4565,2350,3119,3292,3796,3378,4005,4029,4704,3471,4140,4297,4817,4401,4847,5020,5548,2496,3352,3444,4070,3578,4229,4227,4888,3719,4380,4413,4978,4601,5124,5270,5969,3787,4520,4619,5159,4705,5373,5408,6130,4751,5432,5532,6349,5737,6449,6641,7429,2519,3491,3582,4382,3738,4436,4602,5153,3959,4622,4740,5388,4745,5410,5522,6307,4011,4741,4750,5437,4889,5527,5605,6446,5028,5736,5843,6544,6030,6790,6820,7445,4141,4905,4982,5549,5271,5739,5926,6585,5345,6024,6131,6816,6325,6838,6949,7825,5534,6139,6350,6843,6519,6953,7106,8193,6586,7381,7433,8336,7702,8430,8529,9375,1381,2026,2185,2979,2348,3117,3287,3912,2382,3295,3433,4007,3490,4073,4302,5021,2514,3446,3609,4225,3729,4435,4402,5030,3779,4540,4606,5334,4722,5382,5413,6175,2846,3724,3780,4434,3958,4567,4657,5389,4006,4723,4747,5418,4765,5523,5537,6358,4012,4762,4844,5536,5023,5604,5807,6545,5216,6021,6025,6791,6138,6821,6924,7710,2890,3919,4004,4706,4013,4744,4816,5526,4143,4890,4979,5568,5125,5804,6023,6785,4618,5022,5272,5842,5346,6035,6142,6818,5525,6143,6351,6844,6526,6952,7105,8192,4746,5372,5436,6038,5535,6347,6442,6926,5709,6448,6569,7104,6784,7426,7444,8343,5925,6587,6797,7432,6836,7455,7707,8436,6944,7717,7933,8525,8012,8845,8865,9751,2936,4015,4072,4983,4566,5120,5217,6020,4659,5331,5383,6088,5439,6306,6357,6925,4749,5412,5533,6323,5550,6443,6572,6955, 5805,6642,6568,7151,6819,7435,7651,8380,5029,553
9,5571,6518,5968,6584,6796,7430,6033,6798,6823,7
612,684
5,7703,7924,8524,6346,6839,6948,7711,7107,8007,8
013,8809,7427,8277,8342,8895,8431,9194,9248,9706
,5347,57
08,6032,6799,6209,6822,6842,7706,6355,6950,6954,
7932,7380,8010,8337,8864,6359,7150,7431,8276,765
0,8344,8
345,9195,7824,8437,8451,9249,8741,9466,9562,1065
6,6786,7454,7613,8381,7925,8450,8528,9255,8011,8
808,884
4,9467,9086,9563,10064,10780,8204,8894,9087,9707
,9254,9750,10065,10781,9374,10084,10085,10890,10
657,108
91,11544,11545,574,575,1006,1317,1007,1326,1379,
2028,1168,1378,1383,2188,1794,2323,2377,3282,116
9,1382,1
740,2322,1809,2448,2717,3354,1970,2716,2712,3443
,2801,3501,3713,4406,1316,1795,1931,2576,1971,27
15,2755,
3467,2189,2791,2805,3580,2995,3776,3789,4595,237
6,2845,3246,3785,3291,3862,4025,4708,3442,4027,4
205,484
0,4306,4952,5164,5803,1327,1808,2036,2790,2320,2
804,2994,3735,2442,3247,2938,3798,3381,3953,4147
,4739,27
14,2997,3435,4026,3469,4158,4293,4900,3611,4308,
4414,5122,4594,5268,5342,6137,2757,3466,3581,429
2,3777,4
384,4557,5167,3826,4558,4699,5336,4743,5377,5520
,6440,4031,4737,4897,5381,4918,5521,5595,6549,51
55,5601,
5742,6629,5841,6716,6840,7916,1741,2029,2321,299
6,2449,3290,3355,4146,2744,3434,3496,4231,3712,4
379,438
7,5166,2800,3497,3734,4385,3788,4556,4620,5338,3
952,4621,4738,5362,4899,5415,5591,6515,2940,3742
,3827,45
93,3954,4698,4754,5390,4230,4841,4919,5529,5154,
5600,5711,6628,4386,4959,5218,5607,5337,5813,595
5,6714,5
378,6028,6308,6801,6450,6946,7409,7917,2980,3863
,4157,4819,4378,4901,5127,5603,4407,5156,5278,58
02,5343,
5954,6136,6789,4604,5339,5363,6026,5528,6210,644
4,7132,5575,6452,6556,7148,6646,7424,7520,8377,4
753,539
1,5544,6311,5704,6514,6559,7242,5840,6625,6715,7
474,6802,7523,7719,8479,6129,6754,6841,7656,6902
,7831,79
27,8811,7383,8004,8195,8804,8319,8960,9251,9922,
1930,2443,2577,3468,2745,3500,3736,4555,2754,373
7,3799,4
596,3956,4742,4820,5589,2939,3824,3957,4823,4159
,4898,4957,5590,4307,4956,5165,5741,5340,5815,59
58,6713,
2942,4156,4309,4835,4552,4980,5219,5814,4592,533
2,5356,5970,5376,6172,6327,6900,4559,5374,5405,6
171,557
4,6445,6517,7149,5706,6571,6647,7423,6753,7479,7
659,8449,3283,4405,4553,5328,4599,5360,5404,6140
,4709,54
17,5531,6441,5596,6548,6624,7421,5157,5592,5705,
6551,5808,6644,6752,7476,6036,6757,6896,7654,713
5,7830,7
935,8744,5359,5800,5971,6712,6170,6800,6898,7804
,6352,7109,7141,7915,7410,8161,8207,8871,6557,74
08,7425,
8200,7477,8338,8185,9079,7708,8446,8508,9371,852
7,9561,9698,10086,3380,4597,4605,5573,4981,5599,
5710,65
70,5329,5740,5809,6705,6029,6759,6847,7806,5357,
6027,6169,6788,6310,6899,7137,7919,6453,7143,724
1,8009,7
475,8203,8376,9097,5588,6173,6326,7136,6516,7160
,7447,8186,6704,7452,7521,8370,7709,8317,8463,93
73,6795,
7648,7828,8447,7920,8526,8746,9488,8162,8807,880
6,9618,9084,9705,9757,10659,5743,6451,6574,7453,
6758,75
22,7658,8417,6897,7805,7912,8509,8003,8531,8805,
9495,7138,7923,8187,8745,8272,8810,9085,9744,841
6,9185,9
222,9768,9436,10046,10082,10889,7422,8201,8368,9
096,8462,9098,9432,9773,8478,9381,9490,10070,958
2,10181 ,10582,11074,8548,9564,9702,10267,9752,1
0613,10573,11104,9920,10755,10821,11546,10987,1
1594,11671,1233
2,2037,2713,2756,3610,2844,3825,4024,4755,2941,4
030,4204,4822,4311,4954,4958,5810,2943,4310,4404
,4953,45
54,5361,5379,6128,4710,5380,5572,6353,5598,6524,
6575,7473,2981,4415,4598,5375,4736,5545,5593,651
2,4818,5
602,5722,6626,5812,6717,6793,7556,4896,5801,5957
,6756,6141,6846,6947,7714,6211,6901,7144,7922,71
47,8008,
8202,9253,3743,4711,4752,5597,4834,5723,5811,670
7,5123,5959,6037,6825,6305,7111,7142,7826,5279,6
091,632
1,6903,6455,7146,7153,8000,6550,7154,7240,8206,7
615,8339,8438,9380,5358,6454,6546,7163,6631,7446
,7472,82
78,6719,7614,7701,8383,7914,8460,8510,9491,6824,
7718,7921,8511,8163,8743,8877,9583,8347,8892,918
6,9745,9
223,9771,10066,10875,3784,4821,4955,5956,5269,60
90,6309,7134,5341,6344,6513,7155,6558,7382,7411,
8273,54
16,6547,6630,7420,6718,7561,7657,8378,6803,7712,
7913,8477,8001,8549,8846,9492,5594,6706,6792,770
0,7108,7
829,7827,8550,7139,7926,8005,8812,8279,8878,9076
,9747,7243,8184,8341,8961,8379,9217,9250,9774,84
45,9372,

9464,10071,9617,10183,10583,11075,5707,6827,7110,7934,7152,8160,8316,8893,7559,8346,8428,9220,8433,9252 ,9434,10045,7649,8429,8444,9383,8551,9439,9567,10180,8868,9616,9701,10348,9756,10672,10762,11107,7713,8
747,8814,9493,9077,9619,9704,10575,9187,9754,9775,10754,10067,10822,10985,11577,9468,9853,10080,10833,1
0265,11001,11014,11669,10580,11043,11095,11854,11426,12026,12111,12939,3955,5126,5333,6345,5414,6525,66
27,7478,5530,6645,6755,7563,6826,7705,7918,8847,5606,6794,7133,7807,7145,8015,8002,8870,7161,8194,8318,9
184,8418,9218,9369,9921,6168,7140,7162,8014,7558,8275,8369,9221,7562,8419,8435,9370,8461,9435,9471,1008
8,7652,8448,8530,9470,8867,9566,9699,10349,8962,9749,9755,10673,9852,10763,10872,11434,6304,7557,7560,8
382,7653,8432,8476,9438,7715,8742,8813,9560,8879,9696,9753,10615,8340,8866,9078,9700,9192,9769,9854,107
60,9437,9855,10081,10834,10266,11000,11013,11668,8434,9216,9382,9770,9469,10069,10090,10874,9581,10182,
10351,11012,10614,11072,11106,11989,9703,10581,10675,11094,10820,11125,11433,12052,10888,11547,11593,1
2109,11610,12469,12471,13355,6320,7655,7704,8815,8274,8876,8963,9748,8371,9099,9219,9772,9433,10044,100
87,10873,8439,9368,9465,10047,9494,10091,10572,11003,9697,10612,10350,11041,10761,11105,11425,12024,88
69,9489,9565,10264,9746,10574,10674,11092,9759,10752,10783,11126,10835,11427,11578,12108,10068,10823,1
0984,11435,11015,11595,11611,12335,11073,11853,11988,12645,12027,12716,12718,13352,9193,9580,9758,1075
3,9923,10782,10832,11432,10083,10986,11002,11592,11042,1160811855,12470,10089,11040,11093,11852,11424,
11990,11991,12717,11576,12053,12055,12719,12333,13056,13058,13660,10658,11124,11127,12025,11579,12054,
12110,12937,11609,12334,12468,13057,12646,13059,13512,13662,11670,12644,12647,13353,12936,13354,13513,
13663,12938,13514,13515,14160,13661,14161,14162,14163,1172,1173,1174,1639,1175,1744,1747,1972,1636,174
6,1841,2600,1940,2749,2751,3722,1637,1840,1842,2748,1943,2786,2991,3802,1950,2990,2886,3967,3315,4067,41
39,4894,1638,1941,1949,2884,1951,2989,3107,4001,2601,3313,3449,4076,3613,4154,4203,5025,2750,3451,3720,4
201,3801,4392,4527,5266,3966,4537,4703,5420,4756,5540,5718,6589,1745,1942,1974,3312,2602,3448,3612,4149,
2784,3721,3452,4290,3961,4397,4661,5353,2988,3615,3965,4536,4003,4700,4727,5484,4079,4758,4908,5584,502
4,5846,5974,6833,3129,4000,4077,4726,4155,4836,4915,5727,4390,5016,5265,5870,5355,6115,6178,7128,4539,53
51,5423,6135,5486,6179,6437,7389,5715,6483,6552,7449,6653,7488,7608,8520,1843,1973,2603,3614,2787,3800,3
803,4660,3104,3964,4064,4725,4138,4827,4839,5726,3314,4065,4148,4837,4202,4914,5222,5922,4396,5223,5352,
6094,5481,6149,6433,7377,3454,4152,4391,5019,4408,5264,5368,6144,4724,5421,5487,6181,5714,6482,6511,744
8,4838,5579,5844,6487,5871,6635,6655,7470,6132,6806,6956,7533,7156,7904,8177,8521,3570,4393,4663,5371,48
26,5485,5587,6485,4895,5716,5864,6588,5975,6654,6832,7525,5162,5923,6095,6764,6180,6920,7130,7928,6363,7
166,7412,8096,7460,8190,8262,9197,5365,6145,6212,6959,6504,7376,7415,8158,6652,7441,7471,8246,7554,8289,
8441,9337,6831,7496,7609,8364,7802,8515,8573,9577,8167,8840,8969,9458,9111,9778,9929,10776,1948,2785,28
85,4002,3105,4066,4150,4913,3106,4151,4291,5026,4524,5354,5386,6367,3453,4388,4525,5401,4701,5480,5577,6
432,4757,5576,5719,6523,5972,6651,6710,7469,3568,4662,4759,5403,4910,5580,5845,6650,5018,5868,6016,6762,
6114,6918,7049,7800,5017,6112,6147,6917,6362,7131,7379,8097,6506,7417,7461,8189,7495,8261,8373,9315,372
3,4893,4911,5866,5161,6092,6146,6834,5267,6151,6183,7129,6438,7388,7440,8181,5717,6434,6505,7391,6590,74
58,7494,8256,6808,7501,7662,8350,8083,8514,8575,9430,6019,6554,6763,7468,6916,7532,7698,8458,7054,7907,8
089,8519,8178,8889,8991,9631,7413,8176,8191,8970,8257,9128,8965,9817,8422,9312,9338,10035,9363,10245,10
610,10880,3960,5027,5163,6361,5581,6481,6510,7416,5867,6522,6591,7463,6807,7503,7611,8472,6017,6765,691
5,7524,6958,7699,8085,8523,7167,8091,8155,8873,8247,8989,9196,9821,6366,6919,7048,8084,7378,8110,8241,89
66,7462,8242,8263,9190,8423,9107,9319,10037,7531,8314,8504,9313,8532,9362,9456,10210,8890,9461,9460,105 66,9818,10667,10727,11119,6553,7157,7436,8243,7502,8288,8372,9241,7663,8459,8516,9339,8751,9365,9459,10243,8086,8569,8967,9431,9072,9576,9819,10668,9240,9839,9926,10738,10176,10842,10878,11565,8188,8971,9188,9820,9318,9834,10042,10745,9336,10039,10214,10868,10560,10895,11080,11848,9366,10246,10664,10999,10686,11083,11053,11890,10774,11317,11429,12168,11571,12446,12493,12932,1975,2887,3128,4078,3450,4389,4526,5369,3455,4538,4702,5400,4825,5542,5578,6632,3569,4824,4892,5541,4912,6093,6133,6830,5348,6134,6360,7055,6480,7384,7437,8245,3571,4909,5160,6113,5350,6213,6435,7246,5370,6484,6520,7442,6634,7489,7529,8290,5422,6555,6709,7500,6835,7610,7905,8426,6921,7801,8092,8568,8095,8872,8988,9931,4153,5349,5364,6439,5402,6521,6633,7465,5585,6711,6809,7565,6923,7911,8090,8474,5865,6815,7041,7803,7245,8094,8103,8748,7390,8104,8154,8990,8313,9129,9296,10038,6018,7244,7386,8153,7457,8240,8244,9104,7491,8312,8375,9227,8518,9316,9340,10215,7564,8440,8533,9341,8891,9379,9689,10561,9135,9708,9848,10669,9927,10743,10844,11563,4200,5387,5543,6708,5847,6814,6957,8082,5973,7050,7247,8105,7414,8166,8179,9073,6150,7387,7456,8180,7490,8301,8365,9224,7555,8424,8517,9321,8749,9367,9624,10240,6436,7464,7528,8374,7906,8505,8475,9376,8087,8572,8841,9578,9105,9692,9790,10681,8159,8964,9131,9779,9225,9881,9928,10750,9299,10036,10188,10869,10565,10977,11081,11849,6507,7567,7910,8574,8102,8888,9106,9709,8299,9134,9256,9908,9261,9930,10094,10819,8315,9257,9298,10041,9377,10179,10345,10894,9628,10564,10663,11004,10726,11122,11320,11893,8425,9457,9622,10241,9791,10567,10666,11057,9849,10720,10751,11316,10845,11430,11569,12321,10190,10759,10870,11439,10995,11573,11582,12485,11058,11673,11889,12588,12062,12778,12845,13359,4409,5586,5869,7051,6148,7385,7443,8260,6182,7459,7497,8303,7566,8421,8522,9625,6486,7530,7929,8473,8093,8875,8750,9630,8111,8968,9110,9838,9242,9906,9933,10775,6914,8088,8152,8874,8298,9075,9189,9909,8302,9243,9263,10034,9317,10095,10209,10882,8348,9314,9364,10208,9627,10344,10611,11005,9784,10685,10721,11123,10758,11321,11560,12162,6922,8291,8300,9226,8349,9260,9320,10178,8427,9378,9579,10244,9693,10608,10687,11117,9130,9626,9816,10662,9850,10739,10766,11318,10177,10767,10871,11536,10998,11572,11581,12484,9262,9880,10040,10742,10191,10867,10886 ,11562,10357,10976,11049,11580,11116,11846,11892,12643,10665,11059,11133,11888,11428,11899,12107,12816,11564,12169,12365,12841,12472,13021,13061,13751,7040,8351,8420,9623,9074,9688,9785,10684,9191,9835,9907,10744,10043,10818,10881,11561,9297,9932,10189,10843,10242,10887,11052,11575,10609,11082,11048,11623,11319,11891,12031,12768,9629,10211,10247,10994,10680,11056,11132,11850,10737,11134,11323,12020,11537,12063,12360,12840,10866,11431,11568,12163,11583,12447,12473,13013,11847,12581,12642,13139,12779,13258,13284,13658,9851,10356,10736,11135,10777,11322,11438,12106,10879,11570,11574,12364,11672,12466,12589,13060,10883,11622,11851,12580,12030,12704,12705,13259,12320,12817,12827,13285,12933,13454,13538,14164,11118,11898,12021,12769,12361,12826,12844,13291,12467,13012,13020,13455,13150,13539,13924,14292,12492,13138,13151,13659,13290,13750,13925,14293,13358,13968,13969,14486,14165,14487,14880,14881,3130,3131,3962 ,4289,3963,4394,4399,5712,4136,4398,4411,5920,5366,6119,6177,7438,4137,4410,5220,6118,5385,6364,6649,7466,5582,6648,6636,7527,6813,7697,8081,8802,4288,5367,5483,6508,5583,6639,6767,7535,5921,6811,6829,7908,7159,8108,8165,9083,6176,6913,7418,8157,7451,8258,8361,9228,7526,8363,8457,9360,8534,9496,9780,10579,4395,5384,5724,6810,6116,6828,7158,8099,6214,7419,7042,8182,7493,8293,8443,9247,6638,7165,7499,8362,7553,8454,8513,9428,7931,8544,8842,9690,9082,9788,9846,10757,6805,7534,7909,8512,8109,8736,8985,9783,8198,8986,9199,9840,9259,9885,10092,10884,8367,9245,9425,9905,9462,10093,10259,11009,9711,10269,10570,11077,10661,11100,11436,12352,5221,5713,6117,7164,6365,7450,7467,8442,6760,7498,7660,8507,8080,8571,8739,9782,6812,7661,8098,8737,8164,8984,9132,9842,8292,9133,9246,9878,9427,9935,10255,10991,7044,8106,8199,9081,8294,9198,9302,9910,8506,9361,9463,10185,9710,10268,10

359,11076,8738,9503,9786,10347,9841,10621,10671,11098,9
886,10724,10836,11313,10978,11566,11677,12353,7052,8259,8453,9323,8570,9429,9695,10271,8803,9776,9822,1
0578,9847,10670,10756,11121,9108,9843,9879,10722,10184,10778,10892,11588,10251,10980,11044,11620,11086 ,11844,11992,12713,9301,9911,10212,10839,10352,10990,11047,11666,10660,11061,11099,11902,11314,11995,12
171,12835,10749,11110,11437,12056,11550,12327,12363,13015,11675,12444,12487,13008,12587,13140,13287,13
854,5482,6215,6509,7552,6761,7696,8100,8975,6766,8101,8183,9100,8296,9258,9324,10253,7043,8196,8297,932
7,8455,9426,9501,10254,8535,9500,9781,10569,9844,10623,10678,11097,7046,8452,8545,9343,8972,9620,9787,1
0622,9080,9836,9872,10682,9884,10772,10847,11548,8987,9882,9925,10771,10250,10893,10993,11621,10354,11
051,11087,11843,11109,11987,12059,12825,7439,8801,8973,9832,9103,9876,9924,10764,9229,10033,10187,1088
5,10260,11008,11060,11841,9777,10256,10353,11011,10616,11084,11108,11984,10740,11113,11540,12050,11591,
12326,12367,12940,9875,10576,10683,11096,10770,11312,11542,12172,10876,11585,11613,12331,11678,12477,1
2495,13067,11045,11676,11845,12488,11985,12590,12481,13147,12160,12822,12836,13295,12843,13537,13650,1
3970,7492,9101,9109,10249,9621,10263,10358,11050,9833,10568,10617,11089,10725,11115,11539,12174,9873,1
0723,10769,11120,10838,11543,11597,12355,10981,11615,11665,12465,11903,12491,12712,13249,10252,10773,1
0846,11596,10992,11628,11895,12482,11088,11896,11993,12710,12161,12585,12831,13357,11131,12028,12324,1
2823,12356,12842,12942,13508,12478,13011,13010,13550,13148,13657,13757,14167,10571,10979,11054,11897,1
1114,11994,12058,12773,11541,12173,12328,12837,12443,12847,13009,13519,11598,12359,12483,12941,12576,1
3014,13149,13744,12772,13253,13282,13840,13448,13922, 13934, 14485, 11842, 12489,12708,13248,12830,13250,1
3444,13845,12834,13441,13510,13930,13546,13977,14042,14554,12928,13540,13654,13983,13752,14045,14037,1
4784,13852,14175,14297,14882,14491,14890,15139,15272,5725,6637,6804,7930,6912,8197,8360,9303,7045,8366,
8456,9326,8547,9498,9502,10618,7047,8546,8800,9497,8974,9877,9887,10748,9230,9904,10248,10877,10262,109
96,11055,11901,7053,8843,9102,9883,9244,10213,10257,10988,9322,10270,10562,11062,10620,11101,11129,1199
6,9424,10577,10677,11112,10765,11538,11567,12166,10779,11549,11616,12358,11619,12464,12490,13289,8107,9
231,9300,10261,9342,10563,10619,11091,9691,10679,10741,11325,10817,11587,11614,12322,9823,10747,10841,
11551,10983,11618,11625,12440,11010,11626,11664,12494,12023,12591,12818,13440,9874,10982,11006,11631,1
1079,11894,11900,12582,11103,12022,12061,12771,12330,12828,12838,13511,11324,12170,12357,12839,12479,1
2935,13069,13547,12707,13136,13254,13745,13283,13843,13926,14483,8156,9325,9499,10676,9789,10746,10837 ,
11590,9845,10864,10989,11627,11046,11674,11679,12577,10032,11007,11078,11840,11102,12017,12057,12714,1
1315,12164,12329,12833,12441,12929,13022,13516,10258,11090,11128,12060,11584,12325,12323,12930,11599,1
2362,12445,13016,12583,13070,13144,13747,11667,12480,12641,13141,12715,13261,13286,13846,12821,13356,1
3452,13931,13549,13979,14043,14555,10355,11327,11586,12366,11624,12476,12584,13137,11999,12706,12776,1
3280,12781,13288,13446,13921,12029,12777,12820,13443,12931,13451,13543,13976,13064,13548,13653,14032,1
3756,14168,14290,14787,12165,12943,13018,13517,13145,13551,13656,14039,13255,13754,13847,14174,13927,1
4298,14489,14885,13504,13849,13932,14301,13981,14493,14546,15137,14040,14551,14559,15142,14794,15150,1
5271,15419,8295,9694,9837,10865,9934,10997,11063,11986,10186,11085,11111,12019,11326,12105,12354,13023,
10346,11130,11589,12175,11617,12475,12442,13066,11629,12486,12586,13252,12774,13262,13293,13853,10768,
11612,11630,12474,11998,12579,12709,13281,12018,12775,12783,13294,12829,13447,13507,13972,12048,12824,
12846,13506,13063,13542,13651,14033,13142,13749,13755,14169,13848,14291,14480,14798,10816,11997,12016,
12770,12049,12780,12832,13450,12167,12934,13017,13536,13071,13648,13753,14047,12640,13062,13146,13652,
13256,13841,13850,14288,13449,13851,13933,14302,13982,14492,14545,15136,12782,13260,13442,13842,13505,13929,13974,14482,13545,13978,14035,14544,14046,14552,14786,15145,13655,14041,14171,14558,14296,14789,14797,15264,14484,14883,14889,15269,14894,15277,15279,15747,10840,12051,12104,13019,12578,13068,13143,13748,12711,13251,13263,13844,13445,13920,13971,14481,12819,13292,13453,13923,13518,13975,14036,14495,13649,14044,14034,14549,14289,14785,14793,15148,13065,13509,13541,13980,13746,14038,14170,14556,13759,14172,14295,14790,14303,14795,14886,15268,13928,14299,14488,14799,14547,14891,14895,15275,14553,15141,15144,15409,15151,15412,15414,15744,13257,13544,13758,14173,13855,14294,14300,14796,13935,14490,14494,14888,14550,14892,15143,15278,13973,14548,14557,15140,14792,15146,15147,15413,14884,15265,15267,15415,15273,15420,15422,15752,14166,14788,14791,15149,14887,15266,15270,15417,14893,15274,15276,15421,15410,15423,15748,15754,15138,15408,15411,15745,15416,15746,15749,15755,15418,15750,15751,15756,15753,15757,15758,15759,432,433,434,439,435,440,443,696,436,442,445,700,688,833,835,1054,437,444,446,832,691,838,847,1074,694,846,842,1083,971,1107,1115,2006,438,689,693,840,695,845,963,1085,701,969,973,1108,1049,1574,1579,2053,834,975,1052,1577,1073,1716,1763,2118,1082,1765,1775,2412,1876,2424,2618,3209,441,690,698,968,702,972,1048,1569,836,1053,1040,1582,1077,1721,1769,2245,844,1051,1081,1764,1087,1772,1875,2420,1111,1878,2008,2608,2052,2658,2850,3369,965,1084,1109,1874,1575,2000,2015,2623,1714,2048,2117,2666,2247,2863,3034,3584,1767,2243,2415,3015,2422,3035,3137,3693,2615,3143,3196,3921,3257,3992,4212,5092,447,697,703,1050,839,1072,1075,1768,960,1080,1104,1873,1114,1883,2003,2622,970,1105,1568,2001,1578,2014,2062,2670,1720,2063,2244,2858,2417,3029,3053,3681,1042,1572,1715,2051,1724,2116,2252,3024,1872,2413,2423,3037,2614,3142,3187,3920,2002,2531,2656,3147,2667,3215,3259,3990,3012,3278,3516,4169,3664,4280,4489,5093,1046,1717,1771,2255,1882,2421,2611,3145,2007,2616,2660,3208,2851,3258,3368,4089,2058,2671,2859,3272,3036,3512,3586,4336,3047,3670,3888,4364,3932,4582,4642,5633,2249,3025,3040,3519,3148,3680,3891,4482,3256,3901,3991,4634,4174,4645,4937,5773,3311,4080,4213,4812,4278,5055,5117,5993,4487,5292,5325,5938,5503,6070,6401,7352,692,837,841 ,1086,961,1106,1570,2013,962,1571,1583,2054,1760,2246,2402,3051,1041,1712,1761,2405,1773,2416,2529,3052,1877,2528,2619,3191,2848,3255,3262,3989,1044,1770,1879,2407,2010,2536,2657,3254,2050,2664,2852,3266,2862,3506,3537,4276,2049,2860,3027,3505,3046,3587,3683,4365,3150,3893,3933,4581,3999,4641,4853,5755,1055,2005,2011,2662,2057,2856,3026,3370,2119,3031,3039,3585,3138,3692,3900,4493,2617,3054,3149,3695,3210,3926,3998,4636,3300,4085,4218,4806,4347,5054,5119,5902,2855,3198,3267,3988,3504,4168,4222,4974,3542,4283,4357,5091,4490,5301,5459,6015,3889,4488,4583,5326,4637,5616,5313,6249,4866,5752,5774,6411,5883,6617,6870,7548,1076,2055,2059,3045,2537,3141,3186,3892,2663,3190,3211,3935,3279,4087,4215,5040,2853,3273,3375,4088,3518,4223,4349,5095,3671,4359,4463,5297,4635,5457,5632,6253,3050,3507,3536,4348,3682,4458,4589,5314,3934,4590,4643,5626,4867,5499,5759,6425,4095,4802,5044,5753,5104,5882,5936,6538,5302,5949,5948,6858,6250,7071,7191,7891,3197,3665,3896,4591,4086,4644,4852,5649,4219,4975,5088,5775,5283,5885,5939,6615,4350,5113,5315,5903,5460,5992,6251,7072,5648,6271,6398,7194,6476,7402,7546,8049,4580,5327,5624,6252,5758,6266,6430,7201,5772,6427,6610,7508,6776,7591,7808,8596,5886,6618,7068,7647,7182,7811,7685,8602,7334,7961,7989,8828,8055,8958,9205,9892,699,843,964,1110,974,1713,1762,2253,1043,1766,1774,2404,1881,2426,2530,3212,1045,1880 ,2004,2425,2012,2857,3013,3310,2240,3014,3044,3543,3140,3684,3897,4633,1047,2009,2056,2861,2242,3041,3055,3678,2254,3144,3188,3902,3214,3993,4093,4646,2414,3199,3261,4084,3371,4214,4281,4878,3513,4277,4360,5112,4363,5296,5456,6403,1573,2241,2248,3139,2406,3189,3213,3985,2609,3263,3301,4209,3515,4287,4358,5042,2661,3307,3521,4279,3677,4362,4451,5280,3694,4452,4462,5458,4801,5617,5676,6426,2854,3676,3686,4461,3925,4588,4632,5496,3995,4800,4855,5643,5090,5756,5872,6611,4208,4936,5105,5873,5303,5891,6057,6777,5

623,606
4,6280,7073,6399,7199,7404,8047,1576,2403,2427,3
260,2659,3306,3517,4346,2849,3538,3679,4453,3890
,4486,44
91,5461,3030,3687,3924,4492,3994,4797,4813,5640,
4175,4876,5089,5761,5281,5887,6004,6612,3136,398
4,4092,4
854,4282,5045,5043,5888,4351,5116,5293,5994,5497
,6060,6246,7081,4483,5312,5619,6071,5641,6373,64
00,7282,
5679,6424,6532,7509,6857,7593,7809,8597,3151,421
1,4286,5118,4450,5300,5498,6065,4655,5622,5660,6
388,567
3,6402,6474,7395,4803,5661,5678,6429,5889,6479,6
741,7590,6012,6856,6979,7664,7190,7894,7964,8613
,4877,59
37,5998,6613,6247,6859,7070,7761,6281,7184,7283,
7960,7405,7990,8053,8905,6534,7291,7510,7995,763
9,8073,8
130,9169,7762,8397,8601,9416,8790,9534,9793,1043
9,1725,2610,2665,3539,3028,3685,3903,4640,3038,3
927,408
1,4799,4210,4865,5094,6005,3146,4094,4337,5041,4
361,5299,5282,6014,4459,5324,5502,6270,5650,6382
,6405,73
35,3374,4356,4460,5298,4654,5463,5625,6389,4798,
5651,5675,6410,5757,6475,6537,7550,4804,5754,588
4,6536,6
007,6740,6871,7665,6096,7181,7185,7895,7290,7965
,8044,8822,3514,4647,4796,5642,4805,5672,5760,64
78,4879,
5890,5995,6616,6061,6868,7183,7889,5618,6006,624
8,6978,6282,7195,7294,7962,6477,7295,7511,7996,7
646,807
2,8129,9168,5674,6372,6428,7198,6535,7507,7586,8
046,6749,7592,7681,8128,7888,8594,8612,9423,7069
,7763,79
01,8600,7988,8623,8819,9540,8048,8829,8949,9725,
8996,9957,9961,10703,3520,4807,4864,5999,5462,60
56,6097,
7180,5627,6267,6383,7200,6431,7394,7549,8045,567
7,6404,6533,7403,6614,7587,7684,8075,6869,7810,7
680,823
9,7963,8603,8771,9516,6013,6539,6619,7638,7080,7
760,7900,8598,7193,7902,7967,8764,7997,8791,8932
,9724,75
06,7991,8052,8823,8131,8959,8997,9945,8595,9277,
9422,10015,9535,10202,10304,10690,6283,6748,719
2,7903,7
353,7966,7994,8818,7547,8054,8074,8948,8396,8994
,9417,9960,7551,8238,8599,9276,8770,9440,9441,10
203,890
4,9541,9587,10305,9893,10498,10538,11528,7890,86
22,8765,9517,8933,9586,9792,10311,8995,9944,9956
,10499,
10142,10539,11208,11756,9204,10014,10143,10691,
10310,10702,11209,11757,10438,11220,11221,11962
,11529,1
1963,12520,12521,966,967,1078,1581,1079,1718,172
3,2612,1112,1722,1727,2668,2250,3011,3033,3898,1
113,172
6,2060,3010,2401,3048,3253,3986,2538,3252,3248,4
091,3305,4221,4345,5286,1580,2251,2419,3184,2539
,3251,32
75,4171,2669,3303,3309,4284,3667,4456,4485,5467,
3032,3373,3894,4481,3923,4638,4809,5644,4090,481
1,4973,5
880,5106,5984,6076,6867,1719,2400,2620,3302,3008
,3308,3666,4367,3042,3895,3522,4494,3997,4649,49
39,5659,
3250,3669,4083,4810,4173,4966,5053,5900,4339,510
8,5294,6058,5466,6244,6278,7289,3277,4170,4285,5
052,445
7,5200,5453,6079,4586,5454,5635,6272,5663,6377,6
472,7584,4815,5657,5897,6381,5950,6473,6731,7669
,6067,67
37,6862,7781,6977,7860,7992,8924,2061,2613,3009,
3668,3049,3922,3987,4938,3264,4082,4216,5047,434
4,5115,5
203,6078,3304,4217,4366,5201,4484,5452,5620,6274
,4648,5621,5658,6298,5899,6407,6671,7635,3524,44
54,4587,
5465,4650,5634,5746,6390,5046,5881,5951,6529,606
6,6736,6751,7780,5202,5991,6098,6743,6273,6973,7
075,785
8,6378,7188,7396,7937,7594,8050,8481,8925,3540,4
639,4965,5763,5114,5901,6063,6739,5287,6068,6254
,6866,62
79,7074,7288,7893,5500,6275,6299,7186,6528,7354,
7588,8140,6623,7596,7676,8236,7814,8592,8696,951
3,5745,6
391,6608,7399,6744,7634,7679,8386,6976,7777,7859
,8642,7938,8699,8831,9655,7281,7866,7993,8776,80
22,8911,
8935,9947,8399,8956,9171,9940,9351,10016,10307,1
1146,2418,3043,3185,4172,3265,4220,4448,5451,327
4,4449,
4495,5468,4652,5662,5764,6669,3523,4584,4653,576
7,4967,5898,5989,6670,5107,5988,6077,6861,6276,6
975,707
8,7857,3526,4964,5109,5875,5448,5996,6099,6974,5
464,6268,6292,7082,6376,7332,7407,8020,5455,6374
,6397,73
31,6622,7589,7637,8237,6746,7683,7815,8591,7865,
8647,8779,9585,3899,5285,5449,6264,5471,6296,639
6,7292,5
645,6409,6531,7585,6732,7668,7776,8589,6069,6728
,6745,7671,6968,7812,7864,8644,7196,7869,8016,87
74,8143,
8910,8951,9896,6295,6864,7083,7856,7330,7936,801
8,8900,7544,8133,8221,8923,8482,9065,9207,9967,7
677,848
0,8593,9200,8645,9418,9145,10127,8820,9550,9660,
10435,9727,10537,10650,11222,3996,5469,5501,662
1,5997,6
735,6750,7682,6265,6860,6969,7849,7189,7871,7999,8902,6293,7187,7329,7892,7398,8019,8217,8927,7597,8223,8385,8993,8643,9203,9512,10145,6668,7333,7406,8216,7636,8328,8615,9146,7848,8620,8697,9474,8821,9349,9639,10437,7899,8768,8908,9551,8928,9726,9898,10504,9066,9943,9942,10554,10140,10689,10709,11531,6863,7595,7686,8621,7870,8698,8778,9521,8017,8901,8920,9661,8955,9795,9941,10511,8218,8931,9147,9897,9272,9946,10141,10696,9520,10193,10230,10848,10460,11206,11218,11961,8590,9201,9472,10144,9638,10146,10456,10853,9654,10445,10506,11214,10550,11261,11510,12218,9860,10540,10654,11451,10704,11517,11501,12264,11144,11723,11765,12522,12043,12602,12671,13204,2621,3249,3276,4338,3372,4585,4808,5747,3525,4814,4972,5766,5111,5986,5990,6970,3527,5110,5284,5985,5450,6297,6379,7280,5646,6380,6620,7545,6734,7644,7687,8641,3541,5295,5470,6375,5656,6609,6729,7632,5762,6738,6778,7778,6972,7861,7897,8716,5896,6865,7077,7868,7293,7998,8051,8826,7355,8021,8232,8930,8235,8992,9202,10309,4455,5647,5744,6733,5874,6779,6971,7851,6059,7079,7197,7969,7393,8135,8222,8906,6255,7203,7401,8023,7599,8234,8321,8952,7670,8322,8384,9206,8767,9419,9542,10444,6294,7598,7666,8331,7783,8614,8640,9278,7863,8766,8789,9519,8922,9636,9662,10507,7968,8830,8929,9663,9067,9895,10005,10551,9443,10012,10194,10697,10231,10851,11210,11939,4480,5765,5987,7076,6245,7202,7397,8142,6277,7504,7633,8323,7678,8398,8483,9273,6408,7667,7782,8588,7862,8729,8777,9514,7939,8824,8921,9653,8953,9861,9958,10508,6730,7850,7896,8788,8132,8909,8907,9862,8219,8934,8957,9948,9279,10006,10124,10699,8387,9144,9421,10017,9515,10225,10306,10854,9549,10436,10496,11215,10553,11263,11511,12219,6747,7971,8134,8950,8320,9064,9348,10013,8719,9442,9532,10228,9537,10308,10458,11205,8769,9533,9548,10447,9863,10463,10543,11260,9964,10552,10653,11460,10708,11648,11738,12267,8825,9899,9950,10509,10125,10555,10688,11503,10195,10706,10855,11722,11211,11766,12041,12561,10500,10941,11216,11769,11449,12129,12142,12669,11508,12147,12255,12766,12410,12962,13119,13731,4651,6062,6269,7505,6406,7645,7779,8646,6530,7813,7867,8731,7970,8817,8926,9959,6742,7898,8141,8903,8233,8999,8954,9966,8329,9170,9350,10192,9522,10226,10433,11145,7328,8220,8330,8998,8718,9275,9473,10229,8730,9523,9539,10434,9637,10459,10503,11240,8772,9584,9794,10502,9963,10542,10651,11461,10018,10701,10707,11649,10940,11739,11936,12418,7392,8717,8728,9518,8773,9536,9652,10462,8827,9894,9949,10536,10007,10648,10705,11519,9420,9962,10126,10652,10200,10849,10942,11736,10461,10943,11217,11770,11450,12128,12141,12668,9538,10224,10446,10850,10501,11213,11242,11938,10549,11262,11463,12140,11518,12216,12266,12885,10655,11509,11651,12254,11764,12293,12417,12972,11960,12523,12601,13117,12610,13269,13271,14083,7400,8775,8816,9951,9274,10004,10019,10700,9475,10147,10227,10852,10457,11204,11223,11937,9543,10432,10497,11207,10510,11243,11500,12131,10649,11516,11462,12145,11737,12265,12409,12960,9965,10505,10541,11448,10698,11502,11650,12252,10711,11720,11759,12294,11771,12411,12562,13116,11212,11767,12040,12419,12143,12603,12611,13207,12217,12765,12884,13397,12963,13420,13422,14080,10201,10548,10710,11721,11147,11758,11768,12416,11219,12042,12130,12600,12146,12608,12767,13270,11241,12144,12253,12764,12408,12886,12887,13421,12560,12973,12975,13423,13205,13768,13770,14388,11530,12292,12295,12961,12563,12974,13118,13729,12609,13206,13268,13769,13398,13771,14264,14390,12670,13396,13399,14081,13728,14082,14265,14391,13730,14266,14267,14768,14389,14769,14770,14771,1116,1117,1118,1887,1119,2112,2115,2540,1884,2114,2409,3192,2428,3269,3271,4354,1885,2408,2410,3268,2431,3298,3591 ,4578,2534,3590,3510,4791,3931,4851,4875,5894,1886,2429,2533,3508,2535,3589,3675,4793,3193,3929,4161,4868,4341,4962,4971,6009,3270,4163,4352,4969,4577,5208,5319,6242,4790,5321,5639,6412,5748,6540,6774,7765,2113,2430,2542,3928,3194,4160,4340,4941,3296,4353,4164,5050,4785,5213,5629,6289,3588,4343,4789,5320,4795,5636,5655,6468,4871,5750,5940,6664,6008,6982,7086,7985,3689,4792,4869,5654,4963,5876,5947,6783,5206,6000,6241,7006,6291,7211,7338,8136,5323,6287,6415,7287,6470,7339,7581,8413,6771,7619,7672,8617,7845,8

664,876
0,9720,2411,2541,3195,4342,3299,4576,4579,5628,3
672,4788,4848,5653,4874,5771,5879,6782,3930,4849
,4940,58
77,4970,5946,6102,7066,5212,6103,6288,7206,6465,
7301,7577,8393,4166,4960,5207,6003,5288,6240,636
8,7296,5
652,6413,6471,7341,6770,7618,7631,8616,5878,6659
,6980,7623,7007,7787,7847,8638,7284,7942,8076,87
09,8324,
8912,9137,9721,4274,5209,5631,6371,5770,6469,666
7,7621,5895,6772,7000,7764,7087,7846,7984,8701,6
074,706
7,7207,7876,7340,8040,8138,8944,7571,8334,8484,9
040,8628,9150,9270,10205,6301,7297,7356,8079,762
4,8392,8
487,9062,7844,8609,8639,9214,8714,9281,9545,1040
1,7975,8672,8761,9452,8898,9715,9869,10545,9071,
9952,10
025,10466,10159,10858,11169,11752,2532,3297,350
9,4794,3673,4850,4942,5945,3674,4943,5051,6010,5
316,6290 ,6386,7575,4165,5204,5317,6393,5637,646
4,6657,7576,5749,6656,6775,7643,7084,7843,7854,8
637,4272,5630,575
1,6395,5942,6660,6981,7842,6002,7004,7176,7874,7
210,8038,8121,8896,6001,7208,7299,8037,7570,8139
,8395,90
41,7626,8585,8629,9149,8671,9269,9477,10387,4355
,5893,5943,7002,6073,7204,7298,7986,6243,7303,73
43,8137,
7582,8412,8608,9141,6773,7578,7625,8415,7766,862
6,8670,9264,7944,8677,8782,9446,9003,9714,9871,1
0454,71
79,7674,7875,8636,8036,8708,8786,9634,8126,8915,
9033,9719,9138,10009,10119,10599,8485,9136,9151,
10026,9
265,10168,10021,10913,9526,10384,10402,11195,10
411,11365,11514,11952,4784,6011,6075,7569,6661,7
617,7630 ,8584,7003,7642,7767,8631,7943,8679,876
3,9648,7177,7877,8035,8700,8078,8787,9005,9723,8
335,9035,9059,100
01,9215,10117,10204,10917,7574,8039,8120,9004,83
94,9054,9209,10022,8630,9210,9271,10198,9527,101
55,1039
1,11197,8707,9346,9656,10385,9796,10410,10464,11
306,10010,10469,10468,11478,10914,11643,11703,1
2287,76
73,8325,8604,9211,8678,9280,9476,10281,8783,9635
,9716,10403,9903,10413,10467,11363,9006,9865,100
23,1045
5,10120,10544,10915,11644,10280,10927,11150,117
06,11256,11874,11942,12533,9148,10027,10196,109
16,10390,
10922,11202,11713,10400,11199,11310,11924,11472
,11967,12224,12760,10414,11366,11640,12127,1166
2,12227,
12197,12786,11750,12349,12413,13168,12555,13230
,13317,13724,2543,3511,3688,4870,4162,5205,5318,
6369,41
67,5322,5638,6392,5769,6542,6658,7784,4273,5768,
5892,6541,5944,7205,7285,7974,6284,7286,7568,812
7,7616,8
408,8605,9213,4275,5941,6072,7209,6286,7357,7579
,8390,6370,7620,7640,8610,7786,8665,8705,9282,64
14,7675,
7853,8676,7987,8762,8913,9530,8041,8897,9036,986
4,9039,10000,10116,11171,4961,6285,6300,7583,639
4,7641,
7785,8633,6665,7855,7945,8733,8043,8919,9034,965
0,7001,7951,8113,8899,8389,9038,9047,9900,8414,9
048,905
8,10118,9345,10169,10368,11198,7178,8388,8410,90
57,8625,9208,9212,10152,8667,9344,9479,10275,971
8,10388 ,10404,11311,8732,9544,9797,10405,10011,
10443,10601,11473,10175,10692,10936,11645,11151
,11711,11876,125
31,4968,6387,6543,7852,6983,7950,8077,9002,7085,
8122,8391,9049,8486,9070,9139,10121,7302,8411,86
24,9140,
8666,9293,9453,10272,8715,9528,9717,10393,9901,1
0415,10592,11360,7580,8632,8704,9478,8914,9657,9
651,104
40,9007,9868,9953,10546,10153,10604,10910,11657,
9063,10020,10171,10859,10273,10961,11168,11718,
10371,1
1196,11300,11925,11477,12033,12225,12761,7627,8
735,8918,9870,9046,10008,10154,10693,9291,10174,
10312,1
1028,10317,11170,11246,11763,9347,10313,10370,1
1201,10441,11259,11457,11966,10596,11476,11535,
12132,11
702,12290,12376,12789,9529,10465,10558,11361,10
911,11479,11642,12209,10937,11696,11719,12348,1
1877,124
14,12553,13177,11302,11727,11926,12423,12123,12
557,12566,13309,12210,12673,12785,13388,13110,1
3434,136
69,14087,5289,6666,7005,8123,7300,8409,8611,9268
,7342,8627,8673,9295,8734,9525,9722,10593,7622,8
706,894
5,9649,9037,10003,9902,10598,9055,10024,10158,10
926,10282,11026,11173,11751,8034,9032,9056,1000
2,9290,1
0123,10197,11029,9294,10283,10319,11194,10389,1
1247,11305,11954,9444,10386,10412,11304,10595,1
1456,115
15,12133,10904,11661,11697,12291,11726,12377,12
528,13130,8042,9283,9292,10274,9445,10316,10392,
11258,9
531,10442,10547,11364,10605,11512,11663,12285,1
0170,10594,10912,11534,10938,11707,11742,12350,
11257,11
743,11927,12456,12126,12556,12565,13308,10318,1
0960,11200,11710,11303,11923,11958,12530,11469,
12032,12
193,12564,12284,12750,12788,13395,11641,12211,1

2317,12784,12412,12867,13115,13456,12532,13169,
13221,13
665,13272,13765,13773,14423,8112,9447,9524,1055
9,10122,10600,10905,11660,10199,10923,11027,117
12,11203 ,11762,11953,12529,10369,11172,11301,11
875,11362,11959,12196,12559,11513,12226,12192,1
2623,12351,12787,
12967,13424,10597,11307,11367,12122,11656,12208
,12316,12762,11705,12318,12379,12908,12457,1311
1,13216,
13664,11922,12415,12552,13131,12567,13231,13273
,13741,12751,13381,13394,13803,13435,14010,1402
8,14386,
10939,11468,11704,12319,11753,12378,12422,13114
,11943,12554,12558,13220,12672,13266,13389,1377
2,11955,
12622,12763,13380,12966,13408,13409,14011,13176
,13457,13467,14029,13725,14214,14282,14772,1228
6,12866,
12909,13425,13217,13466,13668,14059,13267,13740
,13764,14215,13910,14283,14564,14868,13316,1380
2,13911,
14387,14058,14422,14565,14869,14086,14624,14625
,14958,14773,14959,15224,15225,3690,3691,4786,50
49,4787 ,5210,5215,6768,4872,5214,5291,7064,6302,
7215,7337,8606,4873,5290,6100,7214,6385,7572,784
1,8634,6662,784
0,7788,8703,7949,8785,9001,9938,5048,6303,6467,7
628,6663,7791,7879,8711,7065,7947,7973,8916,8327
,9052,90
69,10139,7336,8033,8586,9061,8619,9266,9449,1027
6,8702,9451,9633,10408,9798,10512,10860,11507,52
11,6384 ,6780,7946,7212,7972,8326,9043,7358,8587,
8114,9142,8669,9285,9547,10287,7790,8333,8675,94
50,8713,9590,97
13,10452,8947,9856,9954,10602,10138,10908,10934,
11725,7941,8710,8917,9712,9053,9888,10113,10863,
9174,10
114,10207,10928,10315,10965,11244,11956,9455,10
285,10449,11025,10470,11245,11411,12137,10695,1
1453,114
98,12221,11533,12260,12420,13208,6101,6769,7213,
8332,7573,8618,8635,9546,7872,8674,8780,9659,900
0,9867,
9891,10862,7948,8781,9042,9889,9068,10112,10172,
10930,9284,10173,10286,10950,10451,11175,11407,
12047,8
116,9050,9175,10137,9286,10206,10374,11030,9658,
10409,10471,11297,10694,11452,11471,12220,9890,
10519,1
0906,11459,10929,11525,11647,12258,10966,11700,
11772,12345,12034,12534,12677,13209,8124,9267,9
589,1039
5,9866,10453,10607,11455,9939,10856,10918,11506,
10935,11646,11724,12289,10156,10931,10951,11698
,11296,
11754,11964,12572,11403,12036,12148,12620,12230
,12748,12896,13417,10373,11031,11308,11775,1146
4,12046,
12151,12666,11532,12213,12259,12870,12346,12899
,13171,13595,11717,12270,12421,13104,12526,1318
3,13219,
13743,12675,13228,13311,13736,13387,13804,14031
,14502,6466,7359,7629,8712,7873,8784,9044,10031,
7878,90
45,9143,10148,9288,10314,10396,11405,8115,9172,9
289,10399,9591,10450,10517,11406,9799,10516,108
61,1149
7,10932,11527,11654,12257,8118,9588,9857,10407,1
0028,10556,10907,11526,10136,10924,10944,11658,
10964,1
1748,11879,12524,10115,10962,11149,11747,11402,
11965,12121,12621,11466,12195,12231,12747,12269
,12883,1
3107,13465,8607,9937,10029,10920,10151,10948,11
148,11740,10277,11193,11299,11957,11412,12136,1
2212,127
45,10857,11408,11465,12139,11520,12228,12268,12
880,11708,12281,12460,12970,12575,13182,13223,1
3732,109
47,11504,11659,12256,11746,12344,12462,13172,11
940,12569,12613,13203,12678,13277,13319,13779,1
2149,126
76,12749,13312,12881,13390,13305,13907,13128,13
462,13596,14063,13667,14281,14354,14626,8668,10
149,1015
7,11401,10557,11415,11470,12194,10921,11496,115
21,12249,11701,12283,12459,13174,10945,11699,11
745,1228
8,11774,12463,12605,13211,12037,12615,12665,132
65,12871,13315,13416,13945,11404,11749,11878,12
604,1212
0,12636,12791,13306,12248,12864,12897,13414,131
29,13385,13471,14085,12315,12964,13180,13463,13
212,1366
6,13734,14228,13278,13739,13738,14310,13908,143
85,14453,14775,11499,12035,12198,12865,12282,12
898,1310
6,13429,12461,13173,13200,13597,13227,13671,137
37,14271,12606,13215,13307,13733,13376,13742,13
909,1441
6,13428,13949,14026,14472,14208,14562,14606,149
57,12746,13313,13412,13944,13470,13946,14116,14
477,1359
4,14113,14230,14602,14306,14665,14738,15090,137
20,14284,14358,14671,14448,14741,14725,15112,14
500,1483
9,14897,15226,15003,15306,15403,15616,6781,7789,
7940,8946,8032,9173,9448,10375,8117,9454,9632,10
398,985
9,10514,10518,11522,8119,9858,9936,10513,10030,1
0949,10967,11716,10278,11024,11400,11941,11414,
12124,12
199,12869,8125,9955,10150,10963,10284,11309,114
09,12044,10394,11454,11474,12214,11524,12261,12
313,1290

0,10448,11505,11653,12280,11741,12458,12535,13134,11755,12525,12616,13214,12619,13264,13314,14057,9051 ,10279,10372,11413,10406,11475,11523,12251,10603,11655,11709,12381,11761,12571,12614,13178,10919,11715,11873,12527,12039,12618,12633,13224,12138,12634,12664,13318,12911,13391,13458,14112,10946,12038,12134,12639,12223,12790,12868,13382,12263,12910,13109,13427,13202,13468,13598,14231,12380,13170,13213,13599,13279,13727,13781,14307,13411,13800,13950,14417,14027,14475,14566,14955,9060,10397,10515,11652,10909,11714,11773,12574,10933,11920,12045,12635,12150,12674,12679,13377,11192,12135,12222,12744,12262,12905,13105,13418,12347,13132,13201,13593,13225,13721,13766,14268,11410,12250,12312,13108,12568,13181,13179,13722,12607,13218,13229,13760,13383,13782,13904,14419,12667,13304,13393,13805,13419,14013,14030,14478,13461,14084,14212,14603,14309,14667,14739,15091,11467,12383,12570,13222,12632,13276,13384,13801,12903,13410,13432,14024,13437,14056,14118,14561,12965,13433,13460,14115,13723,14211,14287,14664,13776,14308,14357,14720,14452,14832,14866,15115,13133,13735,13762,14269,13905,14311,14384,14727,13951,14450,14479,14838,14567,14898,15001,15229,14224,14497,14604,14901,14669,15005,15050,15401,14736,15055,15095,15406,15162,15454,15575,15827,9287,10606,10925,11921,11174,12125,12215,12882,11298,12229,12271,12907,12382,13113,13210,13767,11458,12314,12573,13175,12617,13275,13226,13778,12637,13310,13386,13948,13430,14014,14061,14501,11744,12612,12638,13274,12902,13379,13413,14025,12906,13431,13439,14062,13469,14119,14227,14628,12968,13464,13670,14226,13775,14286,14355,14721,13806,14421,14451,14833,14496,14867,14952,15166,11760,12901,12904,13426,12969,13436,13592,14210,13135,13726,13761,14280,13783,14352,14449,14743,13392,13774,13906,14356,14008,14473,14498,14864,14209,14499,14605,14902,14670,15004,15049,15400,13438,14012,14114,14474,14225,14601,14630,14954,14305,14666,14723,15048,14742,15088,15114,15449,14359,14737,14835,15094,14896,15117,15165,15568,14956,15227,15305,15573,15310,15621,15623,15899,11872,12971,13112,13763,13378,13780,13807,14420,13415,13947,14015,14476,14117,14560,14627,14953,13459,14060,14213,14563,14270,14631,14724,15007,14353,14740,14722,15053,14865,15113,15161,15452,13777,14229,14285,14668,14418,14726,14834,15092,14455,14836,14871,15118,14903,15163,15230,15572,14600,14899,15000,15167,15051,15307,15311,15619,15089,15405,15448,15761,15455,15764,15766,15896,14009,14304,14454,14837,14503,14870,14900,15164,14607,15002,15006,15304,15054,15308,15407,15622,14629,15052,15093,15404,15160,15450,15451,15765,15228,15569,15571,15767,15617,15828,15830,16064,14774,15116,15119,15453,15231,15570,15574,15825,15309,15618,15620,15829,15762,15831,15900,16066,15402,15760,15763,15897,15824,15898,15901,16067,15826,15902,15903,16068,16065,16069,16070,16071,2120,2121,2122,2127,2123,3016,3019,3360,2124,3018,3021,3364,3200,3529,3531,4934,2125,3020,3022,3528,3203,3534,3551,5098,3206,3550,3546,5307,4627,5443,5491,6686,2126,3201,3205,3544,3207,3549,3595,5309,3365,4625,4629,5444,4929,5670,5907,6853,3530,4631,4932,5905,5097,5916,6107,6966,5306,6109,6263,7172,6420,7312,7538,8577,3017,3202,3362,4624,3366,4628,4928,5665,3532,4933,4856,5910,5101,6049,6257,6989,3548,4931,5305,6108,5311,6260,6419,7308,5447,6422,6720,7512,6852,7690,7818,8793,3597,5308,5445,6418,5671,6680,6727,7543,5914,6848,6965,7770,6991,7887,8026,9016,6111,6987,7175,7959,7310,8027,8209,9181,7519,8215,8492,9401,8657,9504,9668,10636,3023,3361,3367,4930,3535,5096,5099,6256,3592,5304,5440,6417,5490,6675,6683,7542,4626,5441,5664,6681,5906,6726,6878,7774,6048,6879,6988,7882,7305,7981,8069,9161,4858,5668,5915,6851,6052,6964,6996,7976,6416,7173,7311,8029,7518,8214,8403,9400,6682,7323,7688,8227,7771,8583,8659,9486,7956,8694,8860,9641,9024,9736,10097,10637,4862,5917,6259,6999,6674,7309,7515,8225,6687,7536,7692,8576,7819,8658,8792,9601,6874,7775,7883,8688,8028,8856,9018,9800,8063,9030,9352,9988,9412,10110,10234,11225,6993,7977,8056,8863,8228,9160,9355,10058,8656,9397,9487,10162,9646,10237,10481,11341,875 9,9592,9669,10380,9734,10631,10717,11441,10063,1
0812,10973,11386,11167,11686,11905,12592,3204,3
533,354
5,5310,3593,5442,5666,6725,3594,5667,5911,6854,6
104,6990,7058,8067,4857,5912,6105,7061,6261,7304
,7321,80
68,6421,7320,7539,8407,7816,8655,8662,9485,4860,
6258,6423,7063,6722,7344,7689,8654,6850,7768,782
0,8682,7
886,8850,9009,9732,6849,7884,7979,8849,8062,9019
,9163,9989,8230,9357,9413,10109,9511,10233,10421
,11291,
4935,6685,6723,7694,6873,7880,7978,8794,6967,798
3,8031,9017,8210,9180,9396,10101,7537,8070,8229,
9183,85
78,9406,9510,10164,8724,9597,9674,10334,9971,106
30,10719,11382,7823,8494,8683,9484,8848,9640,967
8,10526 ,9014,9739,9981,10635,10098,10901,11139,
11495,9353,10096,10111,10974,10165,11176,10953,
11785,10426,1128
8,11342,11915,11355,12065,12238,12692,5100,6855,
6875,8061,7345,8213,8402,9356,7695,8406,8579,941
5,8695,
9599,9671,10528,7821,8689,8799,9600,8862,9679,99
73,10639,9031,9983,10055,10897,10163,11137,1122
4,11789,
8066,8851,9008,9972,9162,10050,10133,10954,9414,
10134,10235,11186,10427,11163,11295,11929,9607,
10330,1
0532,11289,10640,11354,11384,12002,10902,11397,
11396,12202,11786,12311,12399,13027,8493,9025,9
392,1013
5,9598,10236,10420,11249,9675,10527,10632,11343,
10803,11357,11387,12015,9974,10713,10955,11383,
11140,11
440,11787,12336,11248,11799,11886,12402,11972,1
2658,12690,13185,10108,10975,11184,11788,11294,
11794,11
934,12425,11340,11931,12010,12684,12184,12735,1
2944,13524,11358,12066,12308,12815,12390,12947,
12877,13
530,12542,13073,13093,13716,13191,13862,13997,1
4324,3363,3547,3596,5446,4630,5913,6106,6997,485
9,6110,6
262,7060,6673,7314,7322,8580,4861,6672,6684,7313
,6724,7881,7957,8758,6984,7958,8060,9015,8212,91
64,9393,
10161,4863,6721,6872,7885,6986,8057,8071,9158,69
98,8224,8404,9398,8582,9505,9605,10238,7174,8495
,8661,9
596,8795,9670,9737,10478,8857,9733,9984,10712,99
87,10896,11136,11907,5669,6985,6992,8211,7062,84
05,8581 ,9481,7513,8663,8725,9665,8859,9743,9982,
10530,7693,8755,8937,9735,9157,9986,9995,10800,9
182,9996,10054,
11138,10329,11177,11276,11930,7822,9156,9166,10
053,9405,10132,10160,11160,9507,10328,10423,112
35,10634,
11292,11344,12011,9664,10480,10641,11345,10903,
11371,11633,12185,11183,11680,11808,12337,11887
,12407,1
2660,13167,5904,7059,7315,8660,7691,8754,8861,99
70,7817,9010,9159,9997,9354,10062,10099,11141,79
82,9167 ,9404,10100,9506,10325,10381,11232,9647,
10476,10633,11329,10801,11359,11484,12012,8208,
9480,9604,10422,
9738,10533,10531,11368,9975,10716,10813,11442,1
1161,11636,11782,12369,10059,10952,11179,11687,
11233,11
837,11904,12498,11279,11928,11980,12685,12201,1
2737,12945,13525,8231,9667,9742,10718,9994,1090
0,11162,
11681,10295,11182,11268,11868,11273,11906,11970
,12627,10331,11269,11278,11933,11369,11975,1211
7,12734,1
1492,12200,12275,12848,12398,13030,13076,13557,
10477,11385,11446,12013,11783,12203,12310,12889
,11809,1
2392,12499,13072,12661,13094,13189,13793,11982,
12507,12686,13099,12807,13193,13298,13985,12890
,13477,1
3529,14096,13702,14158,14257,14655,6053,7514,77
69,9011,7980,9165,9399,10232,8030,9407,9593,1032
7,9666,1
0425,10638,11485,8226,9606,9801,10529,9985,1089
9,10802,11494,10051,10972,11166,11798,11250,118
62,11909,
12543,8798,9980,10052,10898,10294,11143,11185,1
1869,10326,11251,11275,11914,11293,11971,12001,
12694,10
332,11290,11356,12000,11487,12116,12239,12849,1
1728,12389,12393,13031,12506,13077,13164,13710,
8858,102
39,10324,11234,10333,11272,11328,11974,10479,11
370,11443,12064,11637,12236,12391,13025,11178,1
1486,117
84,12274,11810,12403,12510,13074,11973,12511,12
687,13100,12814,13192,13297,13984,11274,11836,1
1932,124
06,11983,12683,12730,13166,12157,12736,12873,13
296,13024,13522,13556,14103,12309,12891,13037,1
3528,130
92,13567,13707,14180,13184,13717,13837,14253,13
868,14365,14369,14823,8936,10335,10424,11447,11
142,1163
2,11729,12388,11187,11795,11863,12424,11935,126
26,12693,13165,11277,11908,11981,12659,12014,12
731,1287
6,13195,12237,12946,12872,13343,13075,13531,136
83,14140,11493,12003,12067,12806,12368,12888,13
036,1352
6,12401,13038,13079,13676,13101,13703,13828,142
52,12682,13095,13188,13711,13299,13863,13869,14
345,1352
3,14053,14102,14399,14159,14522,14576,14810,118
11,12156,12400,13039,12593,13078,13098,13706,12

691,13190,13194,13836,13476,13866,14097,14368,12695,13342,13527,14052,13682,14104,14105,14523,13792,14181,14195,14577,14325,14698,14730,15184,13026,13566,13677,14141,13829,14194,14256,14583,13867,14344,14364,14699,14446,14731,14992,15292,13996,14398,14447,14811,14582,14822,14993,15293,14654,15012,15013,15354,15185,15355,15560,15561,3598,3599,5102,5909,5103,5918,6051,7516,5488,6050,6055,7772,6994,7955,8025,9394,5489,6054,6876,7954,7057,8064,8653,9482,7346,8652,8648,9603,8753,9677,9969,10806,5908,6995,7307,8400,7347,8651,8691,9643,7773,8727,8757,9740,9027,10048,10061,11155,8024,8797,9358,10057,9403,10166,10377,11236,9602,10379,10525,11352,10642,11416,11692,12235,5919,7056,7540,8726,7952,8756,9026,9991,8058,9359,8938,10102,9509,10289,10483,11267,8650,9029,9595,10378,9645,10494,10629,11380,9803,10644,10814,11634,11154,11780,11806,12505,8693,9642,9741,10628,10049,10784,11037,11695,10130,11038,11227,11800,11271,11857,11968,12728,10383,11265,11377,11861,11398,11969,12091,12853,11683,12113,12206,12917,12273,12988,13096,13820,6877,7517,7953,9028,8065,9402,9483,10482,8680,9594,9672,10535,9968,10715,10787,11694,8752,9673,9990,10785,10060,11036,11180,11802,10288,11181,11266,11826,11379,11911,12087,12803,8940,9998,10131,11153,10290,11226,11282,11870,10534,11353,11399,11977,11682,12112,12159,12916,10786,11423,11730,12119,11801,12245,12339,12986,11858,12396,12628,13041,12738,13186,13489,13821,9012,10167,10493,11331,10714,11381,11639,12115,10807,11684,11790,12234,11807,12338,12504,13029,11164,11803,11827,12394,11976,12594,12732,13324,12071,12740,12860,13340,12950,13520,13616,14137,11281,11871,12008,12631,12152,12802,12863,13402,12272,12913,12987,13586,13042,13619,13719,14223,12497,12994,13097,13688,13126,13799,13831,14347,13479,13860,13987,14340,14095,14400,14579,14962,7306,8059,8401,9644,8681,9676,9992,11035,8690,9993,10103,11156,10292,11270,11332,12085,8939,10128,10293,11335,10495,11378,11421,12086,10643,11420,11693,12205,11804,12247,12342,12985,8942,10492,10645,11347,11032,11444,11731,12246,11152,11796,11820,12370,11856,12540,12663,13124,11039,11838,11885,12539,12070,12733,12805,13341,12154,12875,12951,13503,12993,13591,13691,14193,9395,10805,11033,11792,11159,11824,11884,12508,11237,11913,11979,12729,12092,12852,12912,13501,11685,12088,12153,12855,12240,12948,12992,13588,12404,12997,13120,13686,13327,13798,13839,14328,11823,12232,12371,12984,12538,13040,13122,13788,12688,13301,13333,13819,13490,13937,13999,14375,12861,13488,13521,13992,13589,14098,13961,14439,13708,14190,14236,14651,14255,14729,14802,15014,9508,11157,11165,12069,11445,12095,12158,12874,11793,12204,12241,12977,12397,12999,13103,13790,11821,12395,12537,13028,12630,13123,13329,13823,12741,13335,13401,13865,13587,13995,14136,14457,12084,12541,12662,13328,12804,13368,13559,13962,12976,13564,13617,14130,13709,14093,14207,14653,13035,13680,13796,14191,13824,14254,14330,14704,13938,14343,14342,14754,14444,14809,14829,15187,12207,12739,12878,13565,12998,13618,13690,14145,13121,13789,13816,14237,13859,14259,14341,14711,13330,13827,13963,14329,14048,14346,14445,14816,14144,14513,14534,14840,14684,14990,15010,15353,13502,13993,14128,14456,14206,14458,14680,14845,14222,14661,14706,14998,14750,15029,15158,15458,14276,14732,14806,15083,14824,15173,15133,15488,14960,15251,15301,15562,15371,15610,15655,15804,7541,8649,8692,9802,8796,10129,10376,11283,8941,10382,10524,11334,10647,11418,11422,12242,8943,10646,10804,11417,11034,11825,11859,12496,11238,11860,12068,12689,12094,12812,12879,13585,9013,10815,11158,11839,11264,12009,12089,12800,11330,12114,12186,12914,12244,12989,13033,13636,11376,12233,12341,12996,12509,13102,13187,13714,12595,13125,13336,13826,13339,13864,13994,14581,9999,11239,11280,12093,11346,12187,12243,12979,11635,12343,12405,13081,12625,13303,13334,13794,11791,12427,12657,13127,12743,13338,13361,13856,12854,13362,13400,13998,13679,14099,14182,14660,11822,12742,12850,13371,12919,13558,13584,14054,12991,13678,13701,1

4143,13818,14204,14238,14707,13080,13718,13825,14239,13939,14327,14381,14751,14107,14396,14514,14817,14535,14843,14994,15339,10056,11333,11419,12340,11781,12426,12629,13326,11805,12680,12801,13363,12862,13478,13491,14049,11912,12851,12918,13500,12990,13641,13689,14138,13043,13712,13817,14221,13857,14277,14366,14708,12090,12978,13032,13700,13300,13797,13795,14278,13331,13830,13861,14348,14055,14382,14436,14819,13403,13960,14101,14401,14139,14529,14578,14846,14189,14652,14696,14999,14753,15031,15159,15459,12155,13083,13302,13838,13360,13936,14092,14397,13639,14106,14156,14532,14177,14580,14682,14989,13681,14157,14188,14663,14279,14687,14735,15028,14372,14752,14805,15100,14828,15200,15258,15491,13713,14331,14350,14709,14437,14755,14808,15135,14515,14826,14847,15250,14995,15302,15369,15593,14700,14925,15008,15313,15081,15385,15398,15653,15156,15427,15479,15678,15538,15722,15775,15979,10291,11638,11797,12681,11910,12813,12915,13590,11978,12949,12995,13643,13082,13705,13822,14367,12118,13034,13325,13791,13337,13871,13858,14374,13369,13986,14094,14512,14146,14530,14649,14961,12536,13332,13370,13870,13638,14051,14129,14533,13642,14147,14179,14650,14205,14683,14703,15016,13684,14192,14258,14702,14371,14734,14803,15101,14402,14821,14827,15201,14924,15259,15336,15546,12624,13637,13640,14142,13685,14176,14220,14686,13715,14326,14349,14728,14383,14800,14825,15175,14100,14370,14438,14804,14520,14841,14926,15256,14685,14927,15009,15314,15082,15384,15397,15652,14178,14528,14662,14842,14701,14997,15018,15338,14749,15030,15103,15396,15174,15456,15490,15701,14807,15157,15203,15478,15300,15509,15545,15732,15352,15563,15609,15773,15626,15845,15847,16075,12656,13687,13704,14351,14050,14380,14403,14820,14131,14459,14531,14844,14681,14988,15015,15337,14183,14648,14697,14991,14710,15019,15132,15387,14801,15172,15102,15425,15257,15489,15537,15720,14373,14705,14733,15080,14818,15134,15202,15476,14831,15248,15295,15510,15315,15539,15594,15772,14996,15303,15368,15547,15399,15611,15627,15807,15457,15677,15700,15893,15723,15916,15918,16072,14521,14748,14830,15249,14963,15294,15312,15544,15011,15370,15386,15608,15426,15624,15679,15846,15017,15424,15477,15676,15536,15702,15703,15917,15592,15733,15735,15919,15805,16000,16002,16140,15186,15508,15511,15721,15595,15734,15774,15977,15625,15806,15844,16001,15894,16003,16104,16142,15654,15892,15895,16073,15976,16074,16105,16143,15978,16106,16107,16224,16141,16225,16226,16227,5492,5493,5494,6679,5495,6960,6963,7348,6676,6962,7169,8488,7316,8685,8687,9978,6677,7168,7170,8684,7319,8722,9023,10106,7326,9022,8854,10303,9411,10419,10475,11374,6678,7317,7325,8852,7327,9021,9155,10321,8489,9409,9609,10428,9805,10490,10523,11489,8686,9611,9976,10521,10105,10792,10959,11778,10302,10969,11231,11916,11284,12004,12182,12893,6961,7318,7350,9408,8490,9608,9804,10485,8720,9977,9612,10626,10297,10797,11189,11817,9020,9807,10301,10968,10323,11228,11255,11948,10431,11286,11388,12080,11488,12278,12374,13089,9177,10320,10429,11254,10491,11348,11395,12191,10790,11480,11777,12302,11819,12451,12546,13320,10971,11815,11919,12503,11950,12547,12725,13485,12179,12755,12856,13561,12957,13600,13672,14248,7171,7349,8491,9806,8723,10104,10107,11188,9152,10300,10416,11253,10474,11339,11351,12190,9410,10417,10484,11349,10522,11394,11734,12306,10796,11735,11816,12430,11945,12517,12721,13473,9614,10488,10791,11483,10808,11776,11832,12512,11252,11917,11951,12549,12178,12754,12799,13560,11350,12075,12276,12759,12303,12923,12959,13582,12500,13046,13196,13629,13364,13808,13953,14249,9730,10793,11191,11835,11338,11949,12083,12757,11375,12180,12296,12892,12375,12958,13088,13621,11690,12307,12431,13004,12548,13160,13322,13832,12699,13374,13492,13888,13572,13966,14022,14525,11829,12513,12596,13199,12792,13472,13495,13918,12956,13553,13583,14006,13634,14065,14185,14633,13087,13608,13673,14124,13786,14243,14317,14745,13943,14360,14409,14690,14471,14850,14969,15288,7324,8721,8853,10322,9153,10418,10 486,11393,9154,10487,10627,11490,10956,11818,11866,12703,9613,10788,10957,11881,11229,11944,12073,1272
0,11285,12072,12183,12811,12372,12955,12982,13581,9728,11190,11287,11883,11390,12076,12277,12954,11482,
12300,12384,13002,12450,13158,13241,13784,11481,12448,12515,13157,12698,13323,13475,13889,12794,13497,
13573,13965,13607,14021,14133,14611,9979,11373,11391,12298,11689,12428,12514,13090,11779,12519,12551,1
3321,12726,13484,13552,13957,12181,12722,12793,13487,12894,13570,13606,14016,13048,13613,13694,14110,1
3875,14242,14319,14678,12387,12858,13003,13580,13156,13628,13698,14202,13246,13811,13881,14247,13954,1
4393,14431,14767,13493,13952,13967,14410,14017,14504,14405,14873,14150,14608,14634,14979,14643,15061,1
5170,15344,10296,11491,11691,12697,12077,12753,12798,13496,12299,12810,12895,13575,13047,13615,13675,1
4216,12385,13005,13155,13620,13198,13699,13877,14251,13375,13883,13915,14377,14007,14429,14524,14877,1
2702,13159,13240,13876,13474,13902,14001,14406,13574,14002,14023,14518,14151,14467,14615,14981,13627,1
4090,14232,14609,14260,14642,14688,15042,14394,14693,14692,15126,14874,15195,15223,15503,12857,13365,1
3532,14003,13614,14064,14132,14569,13695,14203,14244,14635,14335,14645,14691,15059,13878,14313,14407,1
4679,14432,14744,14875,15196,14568,14911,14966,15234,15024,15322,15342,15581,13964,14411,14516,14876,1
4614,14906,14986,15241,14632,14983,15046,15332,15120,15359,15464,15672,14646,15062,15192,15383,15214,1
5467,15437,15682,15286,15525,15541,15784,15587,15838,15869,15972,7351,8855,9176,10430,9610,10789,10958 ,11833,9615,10970,11230,11880,11337,12006,12074,12920,9729,11336,11372,12005,11392,12429,12501,13086,11
812,12502,12696,13247,12752,13480,13533,14005,9731,11389,11688,12449,11814,12597,12723,13406,11834,127
56,12808,13554,12922,13601,13625,14066,11918,12859,12981,13612,13091,13674,13809,14154,13161,13785,138
84,14312,13887,14376,14428,14971,10489,11813,11828,12727,11882,12809,12921,13577,12081,12983,13049,136
45,13163,13815,13882,14218,12297,13055,13233,13787,13405,13886,13895,14332,13486,13896,13914,14430,140
89,14505,14592,14982,12386,13404,13482,13913,13569,14000,14004,14464,13603,14088,14135,14539,14246,146
12,14636,15047,13644,14184,14261,14637,14395,14659,14777,15121,14511,14812,14920,15197,14967,15239,153
24,15579,10520,11867,12007,12980,12279,13054,13197,13874,12373,13242,13407,13897,13494,13942,13955,144
33,12518,13483,13568,13956,13602,14077,14125,14536,13635,14152,14245,14617,14333,14647,14760,15056,127
24,13576,13624,14134,13810,14233,14219,14656,13879,14316,14361,14746,14465,14780,14862,15209,13919,144
04,14507,14851,14537,14937,14968,15246,14595,14980,15036,15333,15125,15361,15465,15673,12795,13647,138
14,14318,13894,14392,14466,14813,14075,14510,14584,14948,14589,14970,15022,15299,14091,14585,14594,149
85,14657,15027,15097,15358,14764,15124,15191,15388,15222,15506,15528,15685,14153,14689,14758,15057,148
63,15127,15194,15441,14921,15216,15247,15524,15325,15542,15585,15793,15038,15255,15334,15551,15379,155
89,15598,15861,15442,15657,15681,15884,15742,15930,15965,16079,10809,12082,12301,13243,12516,13481,135
55,14020,12550,13571,13609,14079,13646,14149,14250,14761,12758,13626,13833,14217,13885,14379,14334,147
66,13903,14408,14470,14910,14570,14946,14973,15287,13154,13880,13912,14378,14074,14435,14517,14949,140
78,14571,14591,14978,14613,15023,15041,15346,14108,14610,14644,15040,14763,15096,15171,15389,14856,152
13,15217,15507,15254,15529,15576,15778,13162,14067,14076,14538,14109,14588,14616,15026,14155,14658,147
47,15060,14781,15168,15215,15501,14506,14762,14872,15190,14922,15235,15262,15526,15025,15263,15335,155
52,15382,15588,15597,15860,14590,14936,14984,15238,15039,15331,15350,15578,15109,15360,15433,15596,155
00,15670,15684,15891,15193,15443,15517,15680,15540,15691,15771,15936,15580,15785,15821,15961,15848,159
97,16005,16151,13232,14111,14148,14759,14434,14776,14857,15212,14519,14907,14947,15240,14987,15298,153
45,15577,14593,14972,15037,15323,15058,15351,15436,15591,15169,15466,15432,15639,15527,15683,15727,159 20,14765,15043,15063,15378,15208,15440,15516,15674,15233,15518,15531,15716,15553,15743,15816,15960,153
30,15543,15584,15779,15599,15839,15849,15989,15671,15877,15890,16019,15931,16042,16052,16138,14923,151
08,15232,15519,15289,15530,15550,15770,15343,15586,15590,15820,15656,15842,15885,16004,15347,15638,156
75,15876,15726,15904,15905,16043,15792,15937,15947,16053,15973,16094,16114,16228,15502,15690,15717,159
21,15817,15946,15964,16059,15843,15988,15996,16095,16030,16115,16180,16244,15868,16018,16031,16139,160
58,16150,16181,16245,16078,16192,16193,16262,16229,16263,16304,16305,9178,9179,10298,10625,10299,10794 ,10799,12176,10472,10798,10811,12304,11830,12455,12545,13534,10473,10810,11732,12454,11865,12700,12953 ,13578,12078,12952,12924,13623,13053,13697,13873,14338,10624,11831,11947,12796,12079,12927,13007,13631 ,12305,13051,13085,13812,13367,13900,13941,14443,12544,13153,13498,13917,13563,14018,14121,14540,13622 ,14123,14201,14640,14262,14712,14852,15155,10795,11864,12188,13050,12452,13084,13366,13891,12598,13499 ,13234,13958,13605,14069,14187,14575,12926,13373,13611,14122,13633,14198,14241,14676,13835,14272,14362 ,14778,14442,14860,14918,15253,13045,13630,13813,14240,13901,14320,14425,14855,13990,14426,14527,14912 ,14587,14941,15020,15348,14127,14573,14673,14945,14694,15021,15075,15393,14815,15085,15130,15461,15189 ,15484,15548,15808,11733,12177,12453,13372,12701,13562,13579,14186,13000,13610,13692,14235,13872,14315 ,14323,14854,13052,13693,13890,14321,13940,14424,14508,14914,14068,14509,14574,14934,14675,14975,15071 ,15375,13236,13898,13991,14441,14070,14526,14598,14950,14234,14641,14695,15033,14814,15084,15111,15460 ,14322,14719,14858,15099,14913,15181,15199,15482,14942,15220,15316,15521,15362,15582,15661,15809,13244 ,14019,14197,14619,14314,14677,14783,15087,14339,14848,14878,15154,14919,15198,15252,15505,14468,14915 ,14935,15218,15032,15290,15356,15604,15067,15364,15428,15636,15470,15668,15704,15913,14597,14951,15044 ,15319,15104,15374,15431,15650,15188,15445,15483,15694,15522,15707,15787,15955,15245,15494,15549,15736 ,15566,15799,15819,15991,15659,15836,15863,15984,15883,16020,16055,16174,11946,12599,12797,13632,13001 ,13696,13892,14415,13006,13893,13959,14460,14072,14586,14620,15069,13235,13988,14073,14623,14199,14674 ,14717,15070,14263,14716,14853,15129,14916,15183,15206,15481,13238,14196,14273,14639,14412,14756,14859 ,15182,14440,14908,14928,15210,14940,15284,15327,15564,14427,14938,14965,15283,15066,15357,15377,15637 ,15106,15435,15471,15667,15493,15699,15739,15945,13535,14337,14413,14904,14463,14932,14964,15260,14541 ,14977,15035,15349,15076,15392,15444,15665,14849,15072,15105,15395,15176,15468,15492,15696,15236,15497 ,15556,15730,15607,15798,15823,15980,14931,15152,15211,15480,15282,15520,15558,15788,15340,15601,15629 ,15803,15662,15853,15871,16011,15429,15660,15669,15864,15697,15886,15857,16027,15776,15942,15956,16063 ,15963,16113,16130,16194,13604,14461,14469,15065,14757,15079,15110,15434,14905,15128,15177,15473,15221 ,15499,15555,15790,14929,15219,15281,15504,15318,15559,15613,15811,15365,15631,15649,15841,15695,15867 ,15912,16033,15068,15285,15326,15612,15376,15644,15687,15858,15472,15688,15705,15910,15777,15881,15951 ,16077,15515,15724,15796,15943,15812,15962,15982,16100,15854,15987,15986,16126,16028,16137,16157,16231 ,15131,15363,15438,15689,15498,15706,15738,15925,15557,15789,15800,15957,15835,15967,15985,16111,15614 ,15815,15859,15981,15872,15990,16029,16144,15924,16037,16050,16160,16088,16178,16190,16261,15666,15865 ,15908,16032,15950,16034,16084,16165,15954,16081,16102,16186,16122,16201,16218,16282,15968,16116,16134 ,16207,16152,16221,16213,16288,16172,16239,16249,16306,16267,16314,16323,16344,12189,12925,13044,13834 ,13152,13989,14120,14599,13237,14126,14200,14622,14275,14714,14718,15178,13239,14274,14336,14713,14414 ,14933,14943,15244,14542,14944,15064,15341,15078,15380,15439,15693,13245,14363,14462,14939,14572,15045 ,15073,15372,14618,15086,15122,15446,15180,15485,15513,15708,14672,15153,15205,15496,15261,15554,15583 ,15782,15291,15565,15632,15814,15635,15840,15866,16057,13899,14543,14596,15077,14638,15123,15179,15475 ,14779,15207,15237,15533,15297,15603,15630,15794,14879,15243,15321,15567,15367,15634,15641,15832,15394 ,15642,15648,15870,15719,15887,15938,16080,14930,15366,15390,15647,15463,15686,15692,15878,15487,15718 ,15741,15923,15802,15948,15958,16103,15532,15786,15813,15959,15855,15975,16013,16123,15907,16016,16038 ,16145,16051,16163,16182,16259,13916,14621,14715,15204,14861,15242,15317,15606,14917,15328,15373,15643 ,15430,15658,15663,15873,14976,15391,15462,15664,15486,15713,15737,15914,15523,15780,15801,15953,15833 ,15969,15998,16108,15074,15474,15512,15740,15600,15797,15795,15970,15615,15818,15837,15992,15879,16014 ,16024,16147,15651,15856,15889,16021,15915,16045,16054,16166,15941,16076,16092,16187,16125,16203,16219 ,16283,15107,15535,15602,15822,15640,15852,15880,16017,15711,15906,15928,16048,15933,16056,16086,16177 ,15725,15929,15940,16083,15971,16091,16119,16200,16008,16124,16133,16208,16156,16232,16242,16291,15781 ,15983,15994,16109,16025,16127,16136,16215,16039,16154,16167,16238,16183,16250,16265,16309,16096,16169 ,16188,16253,16205,16269,16274,16321,16216,16279,16287,16326,16298,16334,16343,16363,14071,14782,14909 ,15329,14974,15381,15447,15698,15034,15469,15495,15715,15534,15769,15810,15999,15098,15514,15605,15791 ,15633,15851,15834,16010,15645,15862,15882,16036,15926,16046,16061,16173,15280,15628,15646,15850,15710 ,15875,15909,16049,15714,15927,15935,16062,15949,16087,16099,16196,15728,15944,15966,16098,16007,16118 ,16131,16209,16022,16149,16155,16233,16168,16243,16256,16302,15296,15709,15712,15922,15729,15932,15952 ,16090,15783,15974,15993,16112,16015,16128,16153,16223,15888,16006,16026,16132,16040,16161,16170,16240 ,16089,16171,16189,16254,16206,16268,16273,16320,15934,16044,16082,16162,16097,16185,16198,16258,16121 ,16202,16211,16272,16222,16280,16290,16329,16135,16217,16235,16286,16248,16293,16301,16336,16260,16307 ,16313,16341,16318,16349,16351,16371,15320,15731,15768,15995,15874,16012,16023,16148,15911,16035,16047 ,16164,16085,16176,16195,16257,15939,16060,16093,16179,16110,16199,16212,16271,16129,16220,16210,16277 ,16241,16289,16297,16332,16009,16101,16117,16204,16146,16214,16234,16284,16159,16236,16247,16294,16255 ,16299,16310,16340,16184,16251,16264,16303,16275,16315,16319,16347,16281,16325,16328,16353,16335,16356 ,16358,16368,16041,16120,16158,16237,16175,16246,16252,16300,16191,16266,16270,16312,16278,16316,16327 ,16350,16197,16276,16285,16324,16296,16330,16331,16357,16308,16337,16339,16359,16345,16364,16366,16376 ,16230,16292,16295,16333,16311,16338,16342,16361,16317,16346,16348,16365,16354,16367,16372,16378,16322 ,16352,16355,16369,16360,16370,16373,16379,16362,16374,16375,16380,16377,16381,16382,16383]

**Sequence group 2: Q2_2048**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,1024,1025,160,520,288,528,192,544,70,44,131,81,50,73,15,320,133,52,23,134,384,76,137,82,56,27,97,39,259,84,138,145,261,29 ,1026,1028,43,98,515,88,140,30,146,71,262,265,161,576,45,100,640,51,148,46,75,266,273,517,104,162,1032,1040, 53,193,152,77,164,768,268,274,518,54,83,57,521,112,135,78,289,194,85,276,522,58,1056,1027,168,139,99,86,60,280,89,290,529,524,196,141,101,147,1029,1088,176,142,530,321,31,200,90,545,292,322,532,263,149,102,105,304,296,163,92,47,267,385,1033,1030,546,324,208,386,150,153,165,106,55,328,536,577,548,113,154,79,1041,1034,269, 108,578,224,166,519,552,195,270,641,523,275,580,291,1042,1152,59,169,560,114,277,156,87,197,116,170,61,531, 525,642,1036,1057,281,278,526,177,293,388,91,584,1089,1044,769,198,172,120,201,336,62,282,1280,1058,143,103,178,294,93,644,202,592,323,392,1048,1060,297,770,107,180,151,209,284,648,1031,1153,94,204,298,400,608,352,325,533,155,210,305,547,300,109,1090,1536,184,534,537,115,167,225,326,306,1035,1064,772,157,656,329,110, 117,212,171,1092,1154,776,330,226,549,538,387,308,216,1043,1037,416,271,279,158,1072,1038,337,550,672,118, 332,579,540,389,173,121,553,199,784,179,228,338,312,704,1096,1281,390,174,554,581,1045,1156,393,283,122,448,353,561,1059,1282,203,63,340,394,527,582,556,181,295,285,232,124,205,182,643,562,286,585,1050,1537,299,354,1104,1061,211,401,185,396,1049,1046,344,586,645,593,535,240,206,95,327,564,800,402,1160,1284,356,307,301,417,1288,1062,213,568,832,588,186,646,404,227,896,594,418,302,1538,1120,649,771,360,539,1091,1065,1168,1052,111,331,214,309,188,449,217,408,609,596,551,650,1093,1066,229,159,420,310,1540,1073,541,773,1098,1296, 610,657,333,119,600,339,218,368,652,230,391,313,450,542,1184,1544,334,233,555,774,175,123,658,612,1312,1552,341,777,220,314,1216,1568,424,395,673,583,1094,1068,355,287,183,234,1155,1105,125,557,660,616,1074,1097, 1039,1344,342,316,241,778,563,345,452,397,1157,1076,1047,1158,403,207,674,558,785,432,357,187,236,664,624, 587,1408,1100,780,705,126,242,565,398,1161,1106,346,456,358,405,1080,1051,1121,1063,303,569,244,595,189,566,676,361,706,589,215,786,647,348,419,406,464,680,801,362,1283,1108,590,409,1162,1169,1285,1053,570,788,597,572,219,311,1067,1122,1539,1112,708,598,601,651,421,792,802,611,1164,1054,602,410,1170,1095,231,688,653 ,248,369,190,364,654,659,335,1286,1289,480,315,221,370,1185,1600,1069,1124,613,422,425,451,1664,1075,614,543,235,412,343,372,1172,1070,775,317,222,426,1099,1290,453,237,559,833,804,712,1297,1541,1128,1186,834,661,808,779,1077,1217,617,604,1176,1101,433,720,816,836,347,897,1188,1792,1292,1298,243,662,454,318,675,618, 1542,1078,898,781,376,428,1107,1081,665,736,567,840,625,238,1545,1136,1159,1102,359,457,1313,1218,399,787 ,591,678,1109,1300,434,677,349,245,458,666,620,363,127,191,782,407,1546,1082,1192,1163,436,626,571,465,112 3,1110,681,246,707,350,1084,1304,599,668,790,460,1113,1314,249,682,573,411,803,789,709,365,1553,1548,1220,1165,440,628,689,374,423,466,793,250,1125,1171,1200,1166,1554,1345,1055,1224,371,481,574,413,1114,1569,1316,1346,603,366,468,655,900,805,615,684,1556,1287,710,429,1173,1126,794,252,1129,1328,373,605,848,690,713,632,1320,1187,482,806,1116,1071,427,904,1291,1409,414,223,663,692,1570,1348,835,619,1232,1410,472,455,796 ,809,1174,1177,1189,1130,714,721,837,716,864,810,606,912,1079,1352,722,696,377,435,817,319,1560,1601,621,812,1572,1137,484,430,1178,1103,1293,1132,838,667,488,239,378,459,1602,1248,1190,1543,1576,1219,622,627,437,380,1294,1665,1547,1299,818,461,496,669,679,724,841,629,351,467,1604,1315,1083,1193,438,737,1584,1138,251,462,442,441,469,247,1301,1180,683,842,1111,1221,1140,1194,738,899,670,783,1085,1555,1549,1666,849,820,1305,1302,728,928,1550,1201,791,367,901,630,1317,1412,685,844,633,711,1115,1608,1793,1222,1196,1144,1225,1360,253,691,1086,1306,824,902,686,740,850,375,444,470,483,415,1167,1127,1202,1318,1117,1668,1226,1616,485,905,1347,1416,795,473,1321,1794,634,744,852,960,1131,1204,865,693,1175,1233,797,906,1308,1672,715,807,1118,1228,474,636,1322,1424,1632,1376,694,254,717,575,913,798,1349,1557,1179,1234,1329,1571,1324,1133,811,379,1208,1558,697,431,607,489,1561,1139,866,723,486,908,718,813,476,856,1191,1249,1350,1330,839,725,1796,1181,1680,1353,698,914,752,868,1134,1141,819,814,1236,1195,1800,1354,1250,1573,1562,1411,1332,1240,439,929,490,623,671,739,916,463,843,381,1440,1295,1303,1182,1361,1574,497,930,1696,1142,821,726,961,872,1356,1603,492,631,1564,1413,1197,1145,729,700,443,741,1577,1223,1808,1203,1252,1362,845,920,1336,1728,382,822,1414,1198,851,730,1578,1605,1417,1307,498,880,1146,1472,742,445,471,635,932,687,1377,1585,903,825,1227,1087,1364,1418,500,846,745,826,1551,1606,1580,1205,1319,1309,732,446,1256,1148,1229,1206,1667,1586,962,936,475,853,867,637,1310,1609,1323,1378,1235,1425,907,487,695,746,828,753,1209,1420,1368,1610,854,857,1669,1617,1559,1264,1230,1119,504,799,255,964,1351,1588,1824,1426,1380,1331,909,719,477,915,1325,1441,638,748,944 ,869,1237,1592,491,699,1856,1612,754,858,1210,1670,1428,1251,478,968,1920,1618,1442,1326,1673,1795,383,910,1384,1563,1135,1355,815,976,870,917,727,493,1238,1333,873,701,1212,1473,1241,1432,931,756,1633,1620,1575,1674,860,499,1253,1183,1444,1334,1565,1797,731,823,922,874,1634,1681,918,502,1357,1143,1624,1363,933,743,1242,1392,760,881,1676,1254,1415,1337,1474,1566,1358,1257,494,702,1579,1798,921,501,1199,1147,1682,1636,1365,1801,876,847,992,447,1244,1338,733,827,1448,1419,934,882,1697,1607,937,963,1379,1311,1207,1258,1149,1581,747,505,855,924,1684,1640,1366,1340,1265,1802,734,829,1587,1369,1476,1421,965,938,1427,1231,1698,1582,1809,1456,884,506,1381,1211,749,945,1260,1688,1648,1611,966,755,859,940,1804,1729,1150,1266,1589,1422,1370,1480,830,911,871,639,1382,1429,1327,1593,1268,1619,888,479,1213,1590,1700,1385,1730,1613,946,750,1239,1810,1671,1372,1443,1430,1488,1704,969,508,861,757,1825,1386,970,919,1614,1433,875,862,1594,1812,1621,1596,758,948,1243,1335,1732,1622,1625,1675,1445,1816,977,923,1826,1635,972,761,1626,1434,1255,1712,877,952,1677,1272,495,703,1393,1214,1388,1678,935,978,1683,1359,1504,1339,1245,1394,1637,1446,1449,1475,1638 ,1567,1259,1436,883,762,1367,1396,503,925,1799,1341,1246,1450,878,735,1477,1261,993,885,1583,1857,1828,1736,939,994,1858,1685,1832,1803,1641,1628,1457,1744,1840,1860,980,926,764,941,1371,1921,1267,1686,1478,1342,967,886,1699,1642,831,947,1922,1805,1400,1452,1689,1760,507,889,1591,1864,1649,1262,984,751,1383,1481,942,996,1423,1811,1615,1702,1458,1701,1373,1269,1482,1690,1644,1387,971,890,1151,1215,1806,1431,1460,1650,509,949,973,1000,1595,1489,1705,1270,1731,1374,892,950,1623,1692,1814,1484,1273,1706,863,759,1008,510,1597,1435,1827,1813,1733,1389,1464,1652,1713,1398,1447,1490,979,953,1817,1274,1395,1505,1598,1437,763,974 ,1627,1390,1492,1679,954,879,1924,1829,981,982,1639,1708,1734,1453,1818,1276,927,995,1397,1629,1872,1714,1737,1656,1506,1830,1451,1928,1438,1247,1687,1716,1859,1643,1496,1479,1820,1833,765,956,1738,1745,1861,1740,1888,1834,887,985,1630,1936,1746,1720,1401,1459,997,986,1841,1343,1645,1836,1508,1454,1862,1691,943, 891,1512,1263,1402,1483,1646,1651,1461,1404,1842,1485,998,766,1520,1693,511,988,1703,1748,1865,1653,1375 ,1491,1462,1761,1275,1486,1466,1465,1001,951,1493,1271,1707,1866,1762,1923,1694,1807,1873,1844,1752,1952 ,1815,1391,1002,893,1925,1654,1709,1868,1657,1735,1277,1715,975,894,1848,1926,1710,1764,1874,1399,1468,1494,1507,1439,1509,1929,1009,955,1819,1497,1658,1768,1876,1984,1889,1717,1821,1930,1739,1831,1004,1010,1498,1660,957,983,1718,1278,1741,1599,1937,1822,958,987,1835,1403,1721,1455,1631,1513,1890,1747,1012,999,1510,1932,1742,1837,1500,1880,1863,1749,1016,767,1722,1938,1776,1892,1843,1838,1463,1953,1514,1647,1695,1763,1940,1487,1867,1405,989,1003,1521,1954,1845,1750,1985,1896,1516,1655,1753,1724,1467,1765,990,1005,1869,1944,1406,1846,1875,1754,1522,1904,1766,1469,1495,1659,959,1011,1956,1711,1927,1849,1524,1870,1769,1850,1756,1470,1986,1960,1499,1877,1891,1661,1931,1511,1013,895,1719,1770,1852,1777,1878,1881,1528,1823,1279,1988,1933,1743,1501,1939,1662,1772,1006,1014,1968,1893,1515,1723,1778,1882,1502,1992,1407,1934,1839,2000,1894,1941,1017,1018,1751,1517,1897,1725,1955,1780,1884,1523,1755,1847,1946,1898,1942,1526,1957,1767,991,1020,1784,1905,1518,1726,1945,1525,1900,1871,2016,1471,1757,1851,1958,1906,1961,1987,1771,1529,1879,1948,1758,1853,1989,1962,1908,1530,1773,1969,1990,1779,1883,1964,1854,1935,1895,1663,1912,1503,1970,1774,1993,1532,1885,1781,1994,1943,1899,1886,1782,1972,2001,1947,1996,1785,1901,1976,1519,1727,1959,2002,1007,1015,1907,1786,1527,1949,1902,1759,2017,1909,1963,2018,2004,1950,1788,1965,1991,1910,1855,1971,1531,1913,2008,1775,1966,2020,1995,1914,1533,1973,1997,2024,1916,1974,1887,1783,2032,1534,2003,1977,1019,1021,1787,1998,1978,1903,2005,2006,1951,2019,1789,1980,1911,2009,2021,2010,1967,1915,2022,1790,1535,2012,2025,1975,1022,1023,2026,1917,1999,1918,2033,1979,2028,2034,1981,2007,1982,2011,2036,2023,2040,1791,2013,2027,2014,2029,1983,2035,2037,1919,2030,2038,2041,2042,2015,2044,2031,2039,2043,2045,2046,2047]

**Sequence group 2: Z2_2048**

[0,1,2,7,3,8,11,24,4,10,13,28,16,33,35,78,5,12,14,32,19,38,47,82,22,46,42,89,57,97,105,170,6,17,21,40,23,45,51,91,29,55,59,100,73,112,117,185,34,61,76,115,81,126,135,198,88,137,147,224,154,234,256,369,9,18,26,54 ,30,58,72,107,36,77,62,118,85,129,141,205,44,75,87,136,93,144,153,230,103,156,172,246,184,264,282,405,53,90,101,152,113,162,179,261,122,180,197,274,209,295,312,440,139,203,227,301,232,313,337,467,253,343,362,485,379,508,544,722,15,25,31,74,39,80,83,140,48,86,94,151,104,161,167,260,56,95,106,163,116,178,194,276,128,195,204,290,229,309,331,455,66,110,123,183,130,196,212,302,150,225,233,315,252,342,355,484,166,243,262,347,275,375,381,504,298,394,422,535,444,562,615,723,70,127,143,215,160,231,251,345,171,254,266,368,283,380,404,529,192,277,291,392,314,418,442,568,325,446,470,590,492,624,646,819,211,303,320,425,348,454,473,610,378,481,505,638,536,651,699,867,403,518,545,680,560,717,737,907,613,748,767,902,799,950,1005,1188,20,37,41,92,49,96,108,177,50,109,119,186,132,208,216,329,63,120,133,219,145,228,241,330,155,240,257,361,278,377,384,503,68,142,157 ,221,174,244,263,376,182,272,284,388,294,414,429,558,181,292,305,413,324,443,457,591,350,475,493,623,517,645,683,851,79,169,175,268,191,288,304,406,199,311,319,441,338,466,480,619,255,334,349,469,370,490,516,640,398,521,550,674,571,716,739,892,287,364,389,502,412,534,552,704,434,565,577,721,616,755,785,933,471,614,625,776,641,802,763,959,690,848,868,1019,879,1073,1110,1226,84,187,193,323,245,341,354,474,269,360,371,497,395,523,547,708,285,393,409,528,424,553,573,725,447,581,607,751,639,779,818,963,328,415,428,572,456,600,631,764,496,632,647,814,691,795,859,1023,533,670,714,849,730,878,898,1064,760,905,904,1098,960,1125,1149,1301,363,445,476,633,522,650,682,829,551,705,718,869,745,885,903,1071,574,733,765,893,786,906,961,1126,828,977,998,1158,1034,1198,1218,1377,622,777,810,962,858,972,1030,1169,866,1025,1066,1208,1090,1237,1286,1434,886,1080,1120,1253,1138,1291,1267,1460,1186,1321,1345,1510,1395,1542,1563,1666,27,43,52,102,60,121,134,213,67,138,146,218,159,236,242,372,69,158,168,235,176,289,299,402,200,300,322,435,340,460,477,637,71,173,190,293,202,321,335,450,214,344,356,482,374,509,531,652,22

6,365,383,520,407,546,563,696,419,559,586,732,589,750,778,
1007,111,201,210,339,220,357,373,499,247,385,399,539,421,567,580,710,267,401,427,561,449,588,597,742,468,5
98,606,784,667,803,842,1024,286,448,464,603,487,630,636,790,511,666,685,825,720,854,876,1067,538,698,731,8
77,761,891,935,1091,807,940,980,1127,999,1161,1202,1369,114,217,237,382,265,400,423,570,279,432,451,599,47
2,612,617,787,310,465,486,618,510,661,681,820,537,694,719,865,743,887,918,1068,336,498,530,684,564,715,711,
888,575,736,749,910,791,938,956,1129,611,762,805,951,821,987,1004,1170,847,1022,1046,1209,1097,1241,1287,
1435,351,543,566,738,596,754,794,941,655,806,836,994,839,1006,1032,1197,671,837,846,1029,889,1041,1085,12
36,928,1096,1115,1260,1148,1304,1330,1467,695,899,916,1069,957,1099,1124,1273,981,1140,1171,1320,1203,13
48,1385,1517,1048,1173,1212,1355,1247,1397,1410,1561,1276,1425,1457,1584,1490,1624,1663,1767,131,250,273 ,433,308,461,483,644,318,491,519,663,542,689,724,919,346,532,569,709,587,753,744,932,601,766,798,976,830,99
0,1009,1187,408,576,602,752,654,789,811,995,662,831,841,1018,855,1033,1053,1232,672,850,884,1052,925,1084,
1111,1261,954,1133,1141,1305,1172,1331,1366,1502,420,653,660,824,673,838,864,1040,697,890,911,1072,939,11
06,1139,1299,804,924,958,1114,982,1159,1178,1322,1035,1179,1213,1356,1252,1396,1405,1560,840,986,1028,116
0,1049,1205,1234,1368,1087,1240,1263,1404,1298,1430,1466,1591,1121,1277,1309,1456,1344,1471,1499,1632,13
76,1511,1535,1651,1552,1697,1707,1833,426,675,688,917,788,934,955,1132,815,973,991,1168,1031,1196,1227,13
67,843,1008,1047,1199,1070,1235,1266,1401,1107,1290,1262,1421,1323,1461,1489,1602,929,1065,1081,1246,112
8,1272,1308,1440,1157,1312,1337,1476,1357,1491,1520,1650,1204,1349,1384,1503,1411,1543,1553,1681,1431,15
77,1590,1721,1625,1738,1746,1812,983,1086,1156,1313,1189,1336,1354,1498,1219,1394,1400,1534,1424,1544,15
85,1706,1233,1420,1441,1576,1488,1594,1595,1739,1516,1633,1641,1747,1667,1784,1798,1884,1300,1470,1477,1
603,1521,1640,1662,1757,1545,1680,1696,1785,1734,1799,1850,1946,1562,1720,1735,1813,1756,1832,1851,1947,
1766,1866,1867,1986,1885,1987,2010,2011,64,65,98,149,99,164,189,280,124,188,207,306,238,327,333,514,125,20
6,222,326,249,358,397,526,270,396,386,555,439,585,605,774,148,239,259,366,271,391,417,557,307,437,453,592,5
01,628,643,813,332,459,512,635,525,664,687,844,554,693,727,896,740,920,952,1135,165,248,296,436,316,452,50
0,609,352,513,462,648,541,669,703,861,390,507,549,692,579,712,735,912,595,746,780,942,812,968,996,1185,431,
556,593,734,629,768,797,965,658,800,835,984,863,1017,1050,1230,701,857,901,1027,914,1051,1083,1269,947,10
95,1122,1293,1151,1318,1360,1536,223,281,317,506,359,524,527,702,410,548,582,729,604,759,771,964,438,583,6
08,769,642,796,832,988,668,833,860,1012,909,1043,1077,1255,478,626,659,809,676,834,872,1036,728,897,915,10
55,946,1094,1113,1292,770,931,966,1103,985,1145,1153,1316,1020,1174,1214,1347,1242,1378,1437,1537,494,66
5,707,875,758,913,945,1101,775,948,970,1134,997,1152,1184,1339,826,989,1013,1166,1054,1206,1238,1386,1063 ,1244,1274,1412,1302,1446,1464,1615,871,1037,1058,1217,1104,1254,1279,1428,1150,1285,1317,1454,1350,1469 ,1515,1653,1183,1328,1361,1494,1374,1529,1549,1683,1433,1558,1579,1676,1601,1704,1741,1842,258,353,367,5
78,411,584,620,793,416,621,649,816,678,862,880,1075,463,656,679,883,713,908,927,1076,741,926,953,1119,992,
1147,1162,1315,488,706,747,895,782,936,967,1146,808,978,1000,1164,1016,1200,1223,1372,801,1014,1039,1195,
1062,1239,1257,1413,1108,1281,1303,1445,1327,1463,1497,1643,515,773,783,974,823,1010,1038,1190,845,1045,
1057,1231,1088,1268,1284,1443,949,1078,1105,1271,1136,1296,1326,1458,1176,1333,1364,1492,1389,1528,1551,
1672,1003,1130,1165,1314,1194,1346,1370,1518,1228,1381,1399,1533,1438,1569,1587,1695,1275,1436,1447,158
0,1459,1604,1573,1713,1506,1638,1654,1749,1659,1783,1802,1860,540,817,827,1061,937,1093,1112,1280,975,11
18,1137,1307,1175,1335,1363,1522,1001,1167,1193,1338,1216,1371,1391,1539,1245,1403,1427,1565,1455,1583,1
614,1717,1074,1201,1222,1390,1256,1418,1449,1574,1306,1450,1465,1612,1507,1599,1647,1751,1343,1484,1526,
1639,1540,1658,1674,1774,1570,1679,1678,1796,1714,1809,1823,1895,1123,1243,1282,1451,1334,1468,1496,162 1,1365,1519,1530,1655,1557,1661,1677,1781,1392,1547,1575,1673,1588,1682,1715,1810,1620,1723,1736,1826,1762,1846,1858,1923,1444,1581,1610,1716,1646,1718,1758,1831,1652,1753,1776,1854,1792,1869,1888,1942,1664,1786,1806,1875,1818,1891,1881,1950,1840,1903,1911,1966,1927,1974,1983,2006,297,387,430,594,458,657,686,873,479,700,726,882,757,922,930,1142,489,756,772,921,792,1011,1021,1182,852,1026,1060,1229,1092,1258,1283,1453,495,781,822,1015,856,1059,1079,1250,874,1100,1116,1288,1144,1319,1341,1472,900,1131,1155,1332,1191,1362,1379,1512,1207,1373,1406,1546,1409,1564,1582,1743,627,853,870,1089,894,1117,1143,1311,943,1163,1177,1353,1211,1383,1402,1524,971,1181,1221,1375,1249,1408,1415,1554,1270,1416,1426,1586,1483,1605,1634,1752,1002,1248,1264,1423,1295,1448,1452,1596,1325,1482,1501,1619,1532,1644,1656,1777,1352,1514,1541,1657,1571,1671,1699,1793,1609,1702,1724,1811,1737,1829,1848,1921,634,881,923,1154,969,1180,1215,1388,993,1224,1251 ,1417,1278,1432,1439,1589,1044,1265,1294,1442,1324,1479,1495,1616,1351,1508,1531,1649,1555,1665,1688,1778,1082,1310,1340,1500,1380,1527,1525,1668,1393,1548,1559,1684,1597,1700,1710,1815,1429,1572,1607,1705,1617,1729,1740,1834,1637,1750,1768,1855,1795,1871,1889,1943,1109,1359,1382,1550,1414,1568,1598,1703,1475,1608,1626,1732,1629,1742,1760,1845,1485,1627,1636,1755,1669,1765,1789,1868,1692,1794,1805,1876,1822,1896,1906,1953,1509,1675,1686,1779,1711,1797,1808,1883,1725,1820,1835,1902,1849,1912,1925,1969,1770,1837,1856,1915,1873,1929,1934,1981,1886,1939,1949,1988,1960,1996,2005,2027,677,944,979,1225,1042,1259,1289,1462,1056,1297,1329,1481,1358,1505,1538,1689,1102,1342,1387,1523,1407,1567,1556,1694,1419,1578,1600,1722,1622,1730,1745,1841,1192,1398,1422,1566,1474,1593,1611,1733,1480,1623,1631,1748,1645,1761,1773,1862,1486,1642,1660,1772,1691,1788,1803,1877,1708,1817,1821,1897,1836,1907,1918,1964,1210,1473,1478,1618,1487,1628,1648,1764,1513,1670,1685,1782,1701,1800,1819,1893,1606,1690,1712,1804,1726,1827,1838,1904,1763,1839,1857,1916,1874,1928,1933,1980,1630,1728,1754,1828,1771,1853,1864,1920,1791,1870,1879,1932,1892,1940,1952,1991,1807,1887,1899,1948,1910,1955,1963,1998,1922,1967,1973,2003,1978,2013,2015,2035,1220,1493,1504,1687,1592,1698,1709,1816,1613,1719,1731,1830,1759,1844,1861,1919,1635,1744,1769,1847,1780,1865,1880,1931,1801,1890,1878,1937,1905,1951,1959,1994,1693,1775,1787,1872,1814,1882,1898,1944,1825,1900,1909,1956,1917,1961,1970,2002,1852,1913,1924,1965,1935,1975,1979,2009,1941,1985,1990,2017,1997,2020,2022,2032,1727,1790,1824,1901,1843,1908,1914,1962,1859,1926,1930,1972,1938,1976,1989,2014,1863,1936,1945,1984,1958,1992,1993,2021,1968,1999,2001,2023,2007,2028,2030,2040,1894,1954,1957,1995,1971,2000,2004,2025,1977,2008,2012,2029,2018,2031,2036,2042,1982,2016,2019,2033,2024,2034,2037,2043,2026,2038,2039,2044,2041,2045,2046,2047]

**Sequence group 2: Q2_4096**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,1024,1025,160,520,288,528,192,544,70,44,131,81,50,73,15,320,133,52,23,134,384,76,137,82,56,27,97,39,259,84,138,145,261,29 ,1026,1028,43,98,515,88,140,30,146,71,262,265,161,576,45,100,640,51,148,46,75,266,273,517,104,162,1032,1040,53,193,2048,2049,2050,2052,152,77,164,768,268,274,518,54,83,57,521,112,135,78,289,194,85,276,522,58,1056,1027,168,139,99,86,60,280,89,290,529,524,196,141,101,147,1029,1088,176,142,530,321,31,200,90,545,292,322,532,263,149,102,105,304,296,163,92,47,267,385,1033,1030,546,324,2056,2064,2080,2051,208,386,150,153,165,106,55 ,328,536,577,548,113,154,79,1041,1034,269,108,578,224,166,519,552,195,270,641,523,275,580,291,1042,1152,59,169,560,114,277,156,87,197,116,170,61,531,525,642,1036,1057,2053,2112,2057,2054,281,278,526,177,293,388,91 ,584,1089,1044,769,198,172,120,201,336,62,282,1280,1058,143,103,178,294,93,644,202,592,323,392,1048,1060,297,770,107,180,151,209,284,648,1031,1153,94,204,2065,2058,2066,2176,298,400,608,352,325,533,155,210,305,547,300,109,1090,1536,184,534,537,115,167,225,326,306,1035,1064,772,157,656,329,2060,2081,2113,2068,110,117,

212,171,1092,1154,776,330,226,549,538,387,308,216,1043,1037,416,271,279,158,1072,1038,337,550,672,118,332,579,540,389,173,121,553,199,784,179,228,338,312,704,1096,1281,390,174,2304,2082,2072,2084,554,581,1045,1156,393,283,122,448,353,561,1059,1282,203,63,340,394,527,582,556,181,295,285,232,124,205,182,643,562,286,585,1050,1537,2055,2177,2114,2560,299,354,1104,1061,211,401,185,396,1049,1046,344,586,645,593,535,240,206,95,327,564,800,402,1160,1284,356,307,301,417,2059,2088,2116,2178,1288,1062,213,568,832,588,186,646,404,227,896,594,418,302,1538,1120,649,771,360,539,1091,1065,1168,1052,111,331,214,309,2067,2061,2096,2062,188,449 ,217,408,609,596,551,650,1093,1066,229,159,420,310,1540,1073,2120,2305,2069,2180,541,773,1098,1296,610,657,333,119,600,339,218,368,652,230,391,313,2083,2306,2074,2561,450,542,1184,1544,334,233,555,774,175,123,658,612,1312,1552,341,777,220,314,1216,1568,2128,2085,2073,2070,424,395,673,583,1094,1068,355,287,183,234,1155,1105,125,557,660,616,2184,2308,2312,2086,1074,1097,1039,1344,342,316,241,778,563,345,452,397,1157,1076,1047,1158,403,207,674,558,785,432,357,187,236,664,624,587,2562,2144,2115,2089,1408,1100,780,705,126,242,565,398,1161,1106,346,456,358,405,1080,1051,2192,2076,2117,2090,1121,1063,303,569,244,595,189,566,676,361 ,706,589,215,786,647,348,2564,2097,2122,2320,419,406,464,680,801,362,1283,1108,590,409,1162,1169,1285,1053,570,788,3072,3073,2208,2568,597,572,219,311,1067,1122,1539,1112,2336,2576,2240,2592,708,598,601,651,421 ,792,802,611,1164,1054,602,410,1170,1095,231,688,653,248,369,190,364,654,659,335,1286,1289,480,315,221,370 ,1185,1600,1069,1124,613,422,2118,2092,2179,2129,425,451,1664,1075,614,543,235,412,2098,2121,2063,2368,343,372,1172,1070,775,317,222,426,1099,1290,453,237,2181,2100,2071,2182,559,833,804,712,1297,1541,1128,1186 ,834,661,808,779,1077,1217,617,604,1176,1101,433,720,816,836,347,897,1188,1792,1292,1298,243,662,454,318,675,618,1542,1078,2432,2124,2185,2130,898,781,376,428,2104,2075,2145,2087,1107,1081,665,736,567,840,625,238,2307,2132,2186,2193,1545,1136,1159,1102,359,457,1313,1218,399,787,591,678,1109,1300,434,677,349,245,458 ,666,620,363,127,191,2309,2077,3074,3076,782,407,1546,1082,1192,1163,436,626,2091,2146,2563,2136,571,465,1123,1110,681,246,707,350,1084,1304,599,668,790,460,1113,1314,249,682,573,411,803,789,709,365,2188,2078,2194,2119,1553,1548,1220,1165,440,628,689,374,2310,2313,2209,2624,2093,2148,2688,2099,423,466,793,250,1125,1171,1200,1166,1554,1345,1055,1224,371,481,574,413,1114,1569,1316,1346,603,366,468,655,2196,2094,2123,2314,900,805,615,684,1556,1287,710,429,2321,2565,2152,2210,1173,1126,794,252,3080,3088,2101,2241,1129,1328,373,605,848,690,713,632,1320,1187,482,806,1116,1071,427,904,1291,1409,414,223,663,692,1570,1348,835,619,1232,1410,2200,2125,2212,2816,472,455,796,809,1174,1177,1189,1130,714,721,837,716,864,810,606,912,2316,2322,2566,2102,1079,1352,722,696,377,435,817,319,2131,2105,2569,2160,1560,1601,621,812,1572,1137,484,430,2183,2126,2337,2242,1178,1103,1293,1132,838,667,488,239,2133,2324,2570,2106,378,459,1602,1248,1190,1543,1576,1219,3104,3075,2216,2187,2147,2134,2108,2328,622,627,437,380,1294,1665,1547,1299,818,461,496,669,679,724,841,629,2137,2338,2577,2572,2244,2189,2149,2195,351,467,1604,1315,1083,1193,438,737,1584,1138,251,462,442,441,469,247,1301,1180,683,842,1111,1221,1140,1194,3077,3136,2224,2190,738,899,670,783,1085,1555,1549,1666,849,820,1305,1302,2578,2369,2079,2248,728,928,1550,1201,791,367,901,630,2138,2593,2340,2370,2580,2311,2197,2150,1317,1412,685,844,633,711,1115,1608,1793,1222,1196,1144,1225,1360,253,691,1086,1306,824,902,686,740,850,375,444,470,483,415,1167,1127,1202,1318,1117,1668,1226,1616,485,905,1347,1416,2153,2352,2344,2211,795,473,1321,1794,2140,2095,2315,2433,3081,3078,2594,2372,634,744,852,960,1131,1204,865,693,1175,1233,797,906,2256,2434,2198,2201,2213,2154,2103,2376,1308,1672,715,807,1118,1228,474,636,1322,1424,1632,1376,694,254,717,575,2584,2625,2596,2161,913,798,1349,1557,2202,2127,3089,3082,1179,1234,1329,1571,1324,1133,811,379,1208,1558,697,431,607,489,1561,1139,866,723,486,908,2317,2156,2626,2272,718,813,476,856,1191,1249,1350,1330,2214,2567,2600,2243,2318,2689,2571,2323,839,725,1796,1181,1680,1353,698,914,2628,2339,3090 ,3200,752,868,1134,1141,819,814,1236,1195,1800,1354,1250,1573,2107,2217,2608,2162,1562,1411,1332,1240,43 9,929,490,623,2325,2204,2135,2245,671,739,916,463,843,381,1440,1295,1303,1182,1361,1574,2164,2218,2109,2579,2573,2690,3084,3105,497,930,1696,1142,821,726,961,872,2329,2326,2574,2225,1356,1603,492,631,2341,2436,2139,2632,1564,1413,1197,1145,729,700,443,741,1577,1223,1808,1203,3137,3092,2817,2246,2220,2168,2249,2384,1252,1362,845,920,1336,1728,382,822,1414,1198,851,730,2110,2330,3328,3106,1578,1605,1417,1307,498,880,1146,1472,2191,2151,2226,2342,742,445,471,635,932,687,1377,1585,903,825,1227,1087,2141,2692,2250,2640,2371,2440,3096,3108,1364,1418,500,846,2345,2818,2155,2228,745,826,1551,1606,1580,1205,1319,1309,2199,2257,2332,2696,732,446,1256,1148,1229,1206,1667,1586,962,936,475,853,867,637,1310,1609,1323,1378,1235,1425,907,487,695,746,3079,3201,2142,2252,2346,2448,2656,2400,828,753,1209,1420,1368,1610,854,857,2373,2581,2203,2258,1669,1617,1559,1264,1230,1119,504,799,2353,2595,2348,2157,255,964,1351,1588,1824,1426,1380,1331,3138 ,3584,2232,2582,909,719,477,915,1325,1441,638,748,944,869,1237,1592,491,699,1856,1612,2585,2163,2215,2273 ,2374,2354,3083,3112,754,858,1210,1670,1428,1251,478,968,1920,1618,1442,1326,1673,1795,383,910,2820,2205,2704,2377,2158,2165,2260,2219,3140,3202,2824,2378,2274,2597,2586,2435,1384,1563,1135,1355,815,976,870,917,2356,2264,3091,3085,2464,2319,2327,2206,727,493,1238,1333,873,701,1212,1473,1241,1432,931,756,1633,1620,1575,1674,3120,3086,2385,2598,860,499,1253,1183,2720,2166,2380,2627,1444,1334,1565,1797,2588,2437,2221 ,2169,731,823,922,874,1634,1681,918,502,1357,1143,1624,1363,2601,2247,2832,2227,933,743,1242,1392,2276,2386,2360,2752,760,881,1676,1254,3144,3329,2438,2222,1415,1337,1474,1566,1358,1257,494,702,2602,2629,3093,3204,1579,1798,921,501,2441,2331,2170,2496,1199,1147,1682,1636,1365,1801,876,847,2401,2609,3107,3330,2251,2111,2388,2442,992,447,1244,1338,733,827,1448,1419,934,882,1697,1607,937,963,1379,1311,2575,2630,2604,2229,1207,1258,1149,1581,747,505,855,924,1684,1640,1366,1340,2343,2333,2280,2172,1265,1802,734,829,2253,2230,2691,2610,1587,1369,1476,1421,2334,2633,3098,3585,2347,2402,3152,3109,965,938,1427,1231,1698,1582,1809,1456,884,506,1381,1211,2259,2449,2233,2444,3097,3094,2392,2634,2693,2641,2583,2288,749,945,1260,1688,1648,1611,966,755,2254,2143,2375,2612,2848,2450,3208,3332,859,940,1804,1729,1150,1266,1589,1422,1370,1480,830,911,871,639,1382,1429,1327,1593,1268,1619,2404,2355,2349,2465,3336,3110,2261,2616,888,479,1213,1590,2880,2636,2234,2694,1700,1385,1730,1613,946,750,1239,1810,1671,1372,1443,1430,2452,2275,2944,2642,1488 ,1704,969,508,2466,2350,3586,3168,2697,2819,2408,2587,861,757,1825,1386,970,919,1614,1433,3139,3113,3216,3100,2159,2379,2262,2357,875,862,1594,1812,2236,2497,2265,2456,1621,1596,758,948,2657,2644,2599,2698,1243,1335,1732,1622,1625,1675,1445,1816,3141,3114,2277,2207,977,923,1826,1635,972,761,1626,1434,2468,2358,3588,3121,2589,2821,3146,3344,2658,2705,2381,2167,2648,2387,2266,2416,1255,1712,877,952,2700,2278,2439,2361,1677,1272,495,703,1393,1214,1388,1678,935,978,1683,1359,1504,1339,1245,1394,1637,1446,1449,1475,2498,2590,3232,3592,2382,2281,2603,2822,2223,2171,2706,2660,3360,3600,2389,2825,1638,1567,1259,1436,2268,2362,3264,3616,883,762,1367,1396,2472,2443,2721,2631,503,925,1799,1341,1246,1450,878,735,3142,3116,2403,2335,1477,1261,993,885,2231,2282,3203,3153,1583,1857,1828,1736,2173,2605,2708,2664,939,994,1858,1685,3122,3145,3087,3392,1832,1803,1641,1628,2390,2364,2289,2826,2611,2393,2500,2445,1457,1744,1840,1860,980,926,764,941,1371,1921,1267,1686,3205,3124,3095,3206,2451,2255,2722,2606,2833,2480,2405,2235,2284,2712,2672,2635,1478,1342,967,886,3456,3148,2828,2753,1699,1642,831,947,1922,1805,1400,1452,2174,2290,2613,2446,1689,1760,507,889,1591,1864,1649,1262,984,751,1383,1481,942,996,1423,1811,3209,3154,2394,2504,2406,2453,3128,3099,1615,1702,1458,1701,3169,3111,2351,2617,2292,2643,2237,2614,1373,1269,1482,1690,1644,1387,971,890,2724,2409,2754,2637,1151,1215,1806,1431,2263,2834,2695,2396,2467,2454,2512,2728,2849,2410,3331,3156,2638,2457,3210,3217,3333,3101,2618,2836,1460,1650,509,949,973,1000,1595,1489,1705,1270,1731,1374,892,950,1623,1692,1814,1484,1273,1706,2645,2620,2267,2359,3115,3170,3587,3160,2756,2646,2649,2699,863,759,1008,510,24 69,2840,2850,2659,1597,1435,1827,1813,1733,1389, 1464,1652,3212,3102,2650,2458,1713,1398,1447,149 0,3218,3 143,2279,2736,2701,2296,2417,2238,979,953,1817,1 274,1395,1505,1598,1437,2412,2702,2707,2383,3334 ,3337,25 28,2363,2269,2418,3233,3648,763,974,1627,1390,31 17,3172,2661,2470,1492,1679,954,879,2473,2499,37 12,3123, 1924,1829,981,982,2662,2591,2283,2460,2391,2420, 3220,3118,1639,1708,1734,1453,2823,2365,2270,247 4,1818,1 276,927,995,1397,1629,1872,1714,1737,1656,1506,1 830,3147,3338,2501,2285,1451,1928,1438,1247,2607 ,2881,28 52,2760,3345,3589,3176,3234,1687,1716,1859,1643, 1496,1479,1820,1833,2882,2709,2856,2827,3125,326 5,2665,2 652,3224,3149,2481,2768,765,956,1738,1745,2864,2 884,2395,2945,3236,3840,3340,3346,2291,2710,2502 ,2366,18 61,1740,1888,1834,887,985,1630,1936,1746,1720,14 01,1459,2723,2666,3590,3126,2946,2829,2424,2476, 3155,312 9,2713,2784,997,986,1841,1343,1645,1836,1508,145 4,1862,1691,943,891,2615,2888,2673,2286,3593,318 4,3207,3 150,1512,1263,1402,1483,2407,2505,3361,3266,2447 ,2835,2639,2726,3157,3348,2482,2725,1646,1651,14 61,1404, 1842,1485,998,766,2397,2293,2506,2714,2668,2411, 2175,2239,2830,2455,3594,3130,1520,1693,511,988, 1703,174 8,1865,1653,3240,3211,2484,2674,1375,1491,1462,1 761,1275,1486,1466,1465,2619,2513,3171,3158,1001 ,951,149 3,1271,2729,2294,2755,2398,1707,1866,1762,1923,3 132,3352,2647,2716,2838,2508,3161,3362,1694,1807 ,1873,18 44,2297,2730,2621,2459,2851,2837,2757,2413,3601, 3596,3268,3213,1752,1952,1815,1391,2488,2676,273 7,2422,2 471,2514,2841,2298,1002,893,1925,1654,1709,1868, 1657,1735,1277,1715,975,894,3173,3219,3248,3214, 1848,192 6,1710,1764,3602,3393,3103,3272,2419,2529,2622,2 461,1874,1399,1468,1494,3162,3617,3364,3394,2651 ,2414,25 16,2703,1507,1439,1509,1929,2948,2853,2663,2732, 3604,3335,2758,2477,3221,3174,2842,2300,1009,955 ,1819,14 97,1658,1768,1876,1984,3177,3376,2421,2653,1889, 1717,1821,1930,2896,2738,2761,2680,3368,3235,253 0,2854,1 739,1831,1004,1010,3164,3119,2475,2952,1498,1660 ,957,983,3339,3457,2462,2271,2711,2740,3618,3396, 2883,26 67,3280,3458,2520,2503,2844,2857,1718,1278,1741, 1599,3222,3225,3237,3178,1937,1822,958,987,2762, 2769,288 5,2764,2912,2858,2654,2960,3127,3400,2770,2744,1 835,1403,1721,1455,1631,1513,1890,1747,2425,2483 ,2865,23 67,1012,999,1510,1932,3608,3649,2669,2860,1742,1 837,1500,1880,3620,3185,2532,2478,1863,1749,1016 ,767,322 6,3151,3341,3180,2886,2715,2536,2287,2426,2507,3 650,3296,1722,1938,1776,1892,1843,1838,1463,1953 ,3238,35 91,3624,3267,2670,2675,2485,2428,3342,3713,3595, 3347,1514,1647,1695,1763,2866,2509,2544,2717,272 7,2772,2 889,2677,1940,1487,1867,1405,2399,2515,3652,3363 ,3131,3241,2486,2785,3632,3186,2299,2510,989,100 3,1521,1 954,2490,2489,2517,2295,1845,1750,1985,1896,3349 ,3228,2731,2890,3159,3269,3188,3242,1516,1655,17 53,1724, 1467,1765,990,1005,2786,2947,2718,2831,3133,3603 ,3597,3714,2897,2868,3353,3350,2776,2976,3598,32 49,1869, 1944,1406,1846,1875,1754,1522,1904,2839,2415,294 9,2678,3365,3460,2733,2892,2681,2759,3163,3656,1 766,146 9,1495,1659,3841,3270,3244,3192,3273,3408,2301,2 739,3134,3354,2872,2950,959,1011,1956,1711,2734, 2788,289 8,2423,2492,2518,2531,2463,3215,3175,3250,3366,3 165,3716,3274,3664,1927,1849,1524,1870,1769,1850 ,1756,14 70,2533,2953,3395,3464,1986,1960,1499,1877,2843, 2521,3369,3842,1891,1661,1931,1511,2682,2792,290 0,3008,3 179,3252,2913,2741,1013,895,1719,1770,3223,3281, 2845,2954,3356,3720,2763,2855,3166,3276,2522,268 4,3370,3 472,3680,3424,1852,1777,1878,1881,2742,2302,2765 ,2623,1528,1823,1279,1988,2961,2846,3397,3605,32 27,3282, 3377,3619,1933,1743,1501,1939,3372,3181,2859,242 7,1662,1772,1006,1014,3256,3606,2745,2479,2655,2 537,360 9,3187,1968,1893,1515,1723,2914,2771,2534,2956,2 766,2861,2524,2904,3239,3297,3398,3378,2887,2773 ,3844,32 29,3728,3401,2746,2962,2800,2916,3182,3189,2867, 2862,3284,3243,1778,1882,1502,1992,3848,3402,329 8,3621,1 407,1934,1839,2000,3610,3459,3380,3288,2487,2977 ,2538,2671,1894,1941,1017,1018,2719,2787,2964,25 11,1751, 1517,1897,1725,2891,2429,3488,3343,3351,3230,340 9,3622,1955,1780,1884,1523,2545,2978,3744,3190,2 869,277 4,3009,2920,3404,3651,2540,2679,3612,3461,3245,3 193,2777,2748,2491,2789,1755,1847,1946,1898,1942,1526,19
57,1767,3625,3271,3856,3251,3300,3410,2893,2968,3384,3776,2430,2870,991,1020,1784,1905,3462,3246,2899,27
78,1518,1726,1945,1525,3626,3653,3465,3355,2546,2928,3194,3520,2790,2493,2519,2683,1900,1871,2016,1471,2
980,2735,3425,3633,2951,2873,3275,3135,1757,1851,1958,1906,3412,3466,2548,2894,1961,1987,1771,1529,2793,
2874,3599,3654,3628,3253,3367,3357,2780,2494,3304,3196,3277,3254,3715,3634,3010,2984,2523,2901,2915,268
5,3358,3657,1879,1948,1758,1853,3371,3426,3283,3473,2955,2535,2743,2794,2876,2801,3257,3468,1989,1962,19
08,1530,1773,1969,1990,1779,3416,3658,2902,2905,3717,3665,3607,3312,3278,3167,2552,2847,1883,1964,1854,1
935,2303,3012,3399,3636,3872,3474,3428,3379,2957,2767,2525,2963,1895,1663,1912,1503,1970,1774,1993,1532,
3373,3489,2686,2796,2992,2917,3285,3640,2539,2747,3904,3660,2802,2906,3258,3718,3476,3299,2526,3016,396
8,3666,3490,3374,1885,1781,1994,1943,3721,3843,2431,2958,3432,3611,3183,3403,2863,3024,2918,2965,1899,18
86,1782,1972,2775,2541,3286,3381,2921,2749,3260,3521,2001,1947,1996,1785,3289,3480,2979,2804,1901,1976,1
519,1727,3681,3668,3623,3722,2908,2547,3301,3231,3492,3382,3613,3845,1959,2002,1007,1015,2779,2871,2970,
2922,3682,3729,2966,2550,3405,3191,3672,3411,2981,2791,3290,3440,2808,2929,3724,3302,3463,3385,3522,361
4,3406,3305,2542,2750,3627,3846,2969,2549,3247,3195,3730,3684,3413,3849,2924,2895,1907,1786,1527,1949,30
40,2495,3292,3386,2781,2875,3496,3467,2982,2930,3745,3655,1902,1759,2017,1909,2985,3011,3427,3359,3255,3
306,3197,3629,2795,2553,2903,2972,1963,2018,2004,1950,3732,3688,3414,3388,3313,3850,2782,2877,3635,3417,
3524,3469,3013,2986,3475,3279,1788,1965,1991,1910,3746,3630,3857,3504,2932,2554,3429,3259,2797,2993,330
8,3736,3696,3659,3014,2803,2907,2988,3852,3777,1855,1971,1531,1913,3198,3314,3637,3470,2008,1775,1966,20
20,3418,3528,2878,2959,2919,2687,3430,3477,3375,3641,3
316,3667,2936,2527,3261,3638,3748,3433,3778,3661,2
994,2798,3287,3858,1995,1914,1533,1973,3719,3420,3491,3478,3536,3752,3017,2556,2909,2805,3873,34
34,3018,
2967,3662,3481,2923,2910,3642,3860,3669,3644,2806,2996,3291,3383,3780,3670,1997,2024,1916,1974,3673,372
3,3493,3864,3025,2971,3874,3683,3020,2809,3674,3482,3303,3760,2925,3000,1887,1783,2032,1534,3725,3320,25
43,2751,3441,3262,3436,3726,2983,3026,3731,3407,3552,3387,3293,3442,3685,3494,3497,3523,3686,3615,3307,3
484,2003,1977,1019,1021,2931,2810,3415,3444,2551,2973,3847,3389,3294,3498,2926,2783,3525,3309,3041,2933,
3631,3905,3876,3784,2987,3042,3906,3733,1787,1998,1978,1903,3880,3851,3689,3676,2005,2006,1951,2019,350
5,3792,3888,3908,3028,2974,2812,2989,3419,3969,3315,3734,1789,1980,1911,2009,3526,3390,3015,2934,3747,36
90,2879,2995,3970,3853,3448,3500,3737,3808,2555,2937,2021,2010,1967,1915,3639,3912,3697,3310,3032,2799,3
431,3529,2990,3044,3471,3859,3663,3750,3506,3749,2022,1790,1535,2012,3421,3317,3530,3738,3692,3435,3019,
2938,3199,3263,3854,3479,3508,3698,2557,2997,3021,3048,3643,3537,3753,3318,3779,3422,2940,2998,3671,374
0,3862,3532,3321,3754,2025,1975,1022,1023,2911,2807,3056,2558,3645,3483,3875,3861,3781,3437,3512,3700,37
61,3446,3495,3538,3027,3001,3865,3322,3443,3553,3646,3485,2026,1917,1999,1918,2811,3022,3675,3438,3540,3
727,3002,2927,3972,3877,3029,3030,3687,3756,3782,3501,3866,3324,2975,3043,3445,3677,3920,3762,2033,1979,
2028,2034,3785,3704,3554,3878,3499,3976,3486,3295,3735,3764,3907,3691,3544,3527,3868,3881,2813,3004,378
6,3793,3909,3788,3936,3882,2935,3033,3678,3984,3794,3768,3449,3507,3045,3034,3889,3391,1981,2007,1982,20
11,3693,3884,3556,3502,3910,3739,2991,2939,3560,3311,3450,3531,3694,3699,3509,3452,3890,3533,3046,2814,3
568,3741,2559,3036,3751,3796,3913,3701,3423,3539,3510,3809,2036,2023,2040,1791,3323,3534,3514,3513,3049,
2999,3541,3319,3755,3914,3810,3971,3742,3855,3921,3892,3800,4000,3863,3439,3050,2941,3973,3702,3757,391
6,3705,3783,2013,2027,2014,2029,3325,3763,3023,2942,3896,3974,3758,3812,3922,3447,3516,3542,3555,3487,35
57,3977,3057,3003,3867,3545,3706,3816,3924,4032,3937,3765,3869,3978,3787,3879,3052,3058,1983,2035,2037,1 919,3546,3708,3005,3031,3766,3326,3789,3647,3985,3870,3006,3035,3883,3451,3769,3503,3679,3561,3938,3795,3060,3047,3558,3980,3790,3885,3548,3928,3911,3797,3064,2815,3770,3986,3824,3940,3891,3886,3511,4001,3562,3695,3743,3811,3988,3535,3915,3453,3037,3051,3569,4002,3893,3798,4033,3944,3564,3703,3801,3772,3515,3813,3038,3053,3917,3992,3454,3894,3923,3802,3570,3952,3814,3517,3543,3707,3007,3059,4004,3759,3975,3897,3572,3918,3817,3898,3804,3518,4034,4008,3547,3925,3939,3709,3979,3559,3061,2943,3767,3818,3900,3825,3926,3929,3576,3871,3327,4036,3981,3791,3549,3987,3710,3820,3054,3062,4016,3941,3563,3771,2030,2038,2041,2042,3826,3930,3550,4040,3455,3982,3887,4048,3942,3989,3065,3066,3799,3565,3945,3773,4003,3828,3932,3571,3803,3895,3994,3946,3990,3574,4005,3815,3039,3068,3832,3953,3566,3774,3993,3573,3948,3919,4064,3519,3805,3899,4006,3954,4009,4035,3819,3577,3927,3996,3806,3901,4037,4010,3956,3578,3821,4017,4038,3827,3931,4012,3902,3983,3943,3711,3960,3551,4018,3822,4041,3580,3933,3829,4042,3991,2015,2044,2031,2039,3947,3934,3830,4020,4049,3995,4044,3833,3949,4024,3567,3775,4007,4050,3055,3063,3955,3834,3575,3997,3950,3807,4065,3957,4011,4066,4052,3998,3836,4013,4039,3958,3903,4019,3579,3961,4056,3823,4014,4068,4043,3962,3581,4021,2043,2045,2046,2047,4045,4072,3964,4022,3935,3831,4080,3582,4051,4025,3067,3069,3835,4046,4026,3951,4053,4054,3999,4067,3837,4028,3959,4057,4069,4058,4015,3963,4070,3838,3583,4060,4073,4023,3070,3071,4074,3965,4047,3966,4081,4027,4076,4082,4029,4055,4030,4059,4084,4071,4088,3839,4061,4075,4062,4077,4031,4083,4085,3967,4078,4086,4089,4090,4063,4092,4079,4087,4091,4093,4094,4095]

**Sequence group 2: Z2_4096**

[0,1,2,7,3,8,11,24,4,10,13,28,16,33,35,78,5,12,14,32,19,38,47,82,22,46,42,89,57,97,105,174,6,17,21,40,23,45,51,91,29,55,59,100,73,112,117,189,34,61,76,115,81,126,139,206,88,141,151,232,158,242,268,393,9,18,26,54 ,30,58,72,107,36,77,62,118,85,133,145,213,44,75,87,140,93,148,157,238,103,160,176,258,188,276,294,433,53,90,101,156,113,166,183,273,122,184,205,286,217,311,332,472,143,211,235,317,240,333,357,507,265,363,386,529,403,556,600,818,15,25,31,74,39,80,83,144,48,86,94,155,104,165,171,272,56,95,106,167,116,182,202,288,132,203,212,306,237,325,351,491,66,110,123,187,134,204,220,318,154,233,241,335,264,362,375,528,170,255,274,367,287,399,405,552,314,422,454,587,480,622,687,819,70,127,147,223,164,239,263,365,175,266,278,392,295,404,432,581,200,289,307,420,334,450,474,628,345,482,510,658,536,696,726,947,219,319,340,457,368,490,513,682,402,525,553,714,588,731,791,1011,431,570,601,764,620,813,841,1071,685,852,883,1066,923,1130,1205,1484,20,37,41,92,49,96,108,181,50,109,119,190,136,216,224,349,63,120,137,227,149,236,253,350,159,252,269,385,290,401,408,551,68,146 ,161,229,178,256,275,400,186,284,300,416,310,442,461,618,185,308,321,441,344,475,493,659,370,515,537,695,569,725,767,987,79,173,179,280,195,304,320,434,207,327,339,473,358,506,524,691,267,354,369,509,394,534,568,720,426,573,606,758,631,812,843,1056,303,388,417,550,440,586,608,800,466,625,641,817,688,859,901,1105,511,686,697,892,721,930,871,1139,778,984,1016,1227,1035,1305,1366,1534,84,191,201,343,257,361,374,514,281,384,395,545,423,575,603,804,301,421,437,580,456,609,637,825,483,645,679,855,715,895,946,1143,348,443,460,636,492,672,703,880,544,708,727,942,779,915,999,1231,585,754,810,985,830,1034,1062,1292,868,1069,1068,1346,1140,1389,1429,1673,387,481,520,709,574,730,766,961,607,801,814,1017,849,1041,1067,1303,638,837,881,1057,902,1070,1141,1390,960,1161,1198,1438,1246,1498,1526,1797,694,893,938,1142,998,1152,1238,1449,1010,1233,1294,1508,1334,1569,1642,1910,1042,1320,1380,1589,1410,1651,1611,1960,1478,1697,1737,2058,1823,2130,2163,2394,27,43,52,102,60,121,138,221,67,142,150,226,163,244,254,396,69,162,172,243,180,305,315,430,208,316,342,467,360,500,521,713,71,177,194,309,210,341,355,486,222,364,380,526,398,557,583,736,234,389,407,572,435,602,623,788,451,619,650,836,657,854,894,1207,111,209,218,359,228,381,397,547,259,409,427,591,453,627,644,806,279,429,459,621,485,656,669,846,508,670,678,900,751,931,974,1232,302,484,504,675,531,702,712,910,559,750,769,953,
816,994,1032,1295,590,790,831,1033,869,1047,1107,
1335,935,1120,1172,1391,1199,1441,1502,1781,114,
225,245,
406,277,428,455,630,291,464,487,671,512,684,689,9
03,326,505,530,690,558,745,765,948,589,786,815,10
09,847,1
043,1086,1300,356,546,582,768,624,811,807,1044,63
9,840,853,1074,911,1118,1136,1393,683,870,933,113
1,949,11
79,1204,1450,983,1230,1266,1509,1345,1573,1643,1
911,371,599,626,842,668,858,914,1121,739,934,968,
1194,971 ,1206,1244,1497,755,969,982,1237,1045,12
61,1325,1568,1100,1344,1371,1604,1428,1676,1710,
1967,787,1063,10
84,1301,1137,1347,1388,1621,1173,1416,1451,1696,
1503,1752,1809,2065,1272,1461,1520,1759,1579,183
3,1858,2
161,1628,1881,1953,2212,2014,2296,2379,2627,135,
262,285,465,324,501,527,724,338,535,571,747,598,7
77,824,1
087,366,584,629,805,651,857,848,1104,673,882,922,
1160,962,1182,1213,1479,436,640,674,856,738,909,9
39,1195,
746,963,973,1226,995,1245,1277,1556,756,986,1040,
1276,1093,1324,1367,1605,1134,1397,1417,1677,146
0,1711,
1778,2046,452,737,744,952,757,970,1008,1260,789,1
046,1075,1304,1119,1362,1411,1663,932,1092,1138,
1370,11
74,1439,1466,1698,1247,1467,1521,1768,1588,1832,
1849,2160,972,1178,1236,1440,1273,1505,1558,1780
,1327,15
72,1607,1848,1662,1902,1966,2223,1381,1629,1681,
1952,1736,1975,2039,2316,1796,2059,2099,2347,214
0,2465,2
475,2821,458,759,776,1085,908,1106,1135,1396,943,
1153,1183,1448,1239,1496,1535,1779,975,1212,1267
,1499,1
302,1559,1610,1837,1363,1650,1606,1877,1699,1961
,2013,2250,1101,1293,1321,1578,1392,1620,1680,19
16,1437,
1684,1729,1988,1769,2015,2068,2346,1504,1753,180
8,2047,1859,2131,2141,2417,1903,2193,2222,2521,2
297,255
4,2582,2768,1175,1326,1436,1685,1485,1728,1758,2
038,1527,1822,1836,2098,1880,2132,2213,2474,1557
,1876,19
17,2192,2012,2230,2231,2555,2064,2317,2337,2583,
2395,2688,2714,2996,1672,1974,1989,2251,2069,233
6,2378,2
609,2133,2416,2464,2689,2546,2715,2870,3206,2162
,2520,2547,2769,2608,2820,2871,3207,2626,2934,29
35,3442,
2997,3443,3570,3571,64,65,98,153,99,168,193,292,1
24,192,215,322,246,347,353,566,125,214,230,346,26
1,382,42
5,578,282,424,410,611,471,649,677,890,152,247,271,
390,283,419,449,617,323,469,489,660,549,700,723,9
41,352,4
95,564,711,577,748,771,980,610,785,827,1060,844,1
088,1132,1399,169,260,312,468,336,488,548,681,372
,565,502 ,728,597,753,799,1005,418,555,605,784,643
,808,839,1076,663,850,896,1122,940,1148,1196,1477
,463,616,661,838 ,701,884,921,1145,742,928,967,117
6,1007,1225,1274,1554,797,997,1065,1235,1078,127
5,1323,1613,1127,1343,13
82,1657,1431,1694,1772,2104,231,293,337,554,383,5
76,579,798,438,604,646,829,676,867,887,1144,470,6
47,680,8
85,722,920,964,1180,752,965,1004,1220,1073,1263,1
309,1591,522,698,743,937,760,966,1020,1248,828,10
61,1079 ,1279,1126,1342,1369,1656,886,1103,1146,1
351,1177,1421,1433,1692,1228,1462,1522,1739,1574
,1798,1913,2105 ,538,749,803,1023,866,1077,1125,1
349,891,1128,1150,1398,1197,1432,1476,1731,954,1
181,1221,1446,1278,1506,
1570,1810,1291,1576,1622,1864,1674,1922,1964,226
7,1019,1249,1282,1525,1360,1590,1631,1900,1430,1
641,169
3,1946,1754,1973,2063,2357,1475,1708,1773,2018,1
786,2093,2137,2419,1909,2146,2195,2408,2249,2472
,2573,28
50,270,373,391,642,439,648,692,913,448,693,729,94
4,762,1006,1036,1307,503,740,763,1039,809,1072,10
95,1308,
845,1094,1133,1379,1192,1423,1442,1687,532,802,8
51,1059,898,1116,1147,1422,936,1162,1200,1444,12
24,1500,
1531,1784,929,1222,1251,1491,1290,1571,1597,1865
,1364,1637,1675,1921,1703,1963,2037,2339,567,889,
899,115
4,951,1214,1250,1486,981,1265,1281,1555,1332,161
2,1640,1919,1129,1310,1361,1615,1408,1660,1702,1
954,1464 ,1717,1776,2016,1813,2092,2139,2404,120
3,1394,1445,1686,1490,1738,1782,2066,1552,1805,1
835,2097,1914,217
3,2215,2455,1623,1912,1923,2196,1955,2252,2181,2
493,2050,2322,2358,2597,2375,2675,2734,2920,596,
945,955,
1289,1117,1341,1368,1636,1155,1378,1409,1679,146
3,1719,1775,2070,1201,1447,1489,1730,1524,1783,1
815,210
7,1577,1839,1883,2169,1947,2199,2266,2505,1306,1
501,1530,1814,1596,1870,1925,2182,1678,1926,1965
,2264,20
51,2243,2343,2599,1735,2008,2082,2323,2128,2374,
2406,2646,2174,2411,2410,2712,2494,2753,2795,302
3,1383,1
575,1638,1927,1718,1972,2036,2281,1777,2067,2094
,2359,2145,2377,2409,2673,1820,2135,2183,2405,22
20,2418,
2495,2754,2280,2523,2552,2802,2618,2862,2914,312
3,1920,2197,2258,2504,2342,2506,2610,2811,2356,2
601,266
0,2882,2708,2941,3004,3190,2392,2690,2738,2955,2

790,3007,2981,3250,2848,3043,3087,3326,3127,3362
,3415,35
34,313,411,462,662,494,741,770,1021,523,796,826,1
038,865,1090,1102,1418,533,864,888,1089,912,1215,
1229,14
74,992,1234,1288,1553,1340,1598,1639,1945,539,89
7,950,1223,996,1283,1311,1582,1022,1348,1376,164
8,1420,1
695,1733,1980,1064,1395,1435,1716,1487,1774,1799
,2060,1507,1785,1850,2134,1857,2168,2198,2575,69
9,993,10
18,1333,1058,1377,1419,1683,1123,1443,1465,1757,
1511,1807,1838,2080,1151,1473,1529,1787,1581,185
6,1867,2
142,1614,1868,1882,2214,1999,2253,2318,2600,1202
,1580,1608,1879,1659,1924,1944,2240,1701,1998,20
45,2279,
2096,2340,2372,2661,1756,2062,2129,2373,2175,239
9,2467,2709,2257,2470,2524,2755,2553,2809,2868,3
121,710,
1037,1091,1434,1149,1472,1523,1812,1193,1532,158
3,1869,1630,1908,1915,2221,1264,1609,1658,1918,1
700,199
1,2019,2276,1755,2056,2095,2345,2143,2393,2436,2
662,1322,1682,1732,2044,1804,2083,2081,2396,1821
,2136,21
47,2424,2241,2468,2482,2771,1901,2180,2255,2473,
2277,2533,2572,2822,2321,2598,2640,2883,2711,294
3,3005,3
191,1365,1771,1806,2138,1866,2172,2242,2471,1983
,2256,2298,2544,2313,2574,2616,2861,2009,2299,23
20,2603,
2397,2625,2697,2940,2452,2710,2737,2976,2794,303
2,3070,3265,2057,2407,2426,2663,2483,2713,2752,2
983,252
5,2792,2823,3042,2869,3088,3125,3333,2642,2841,2
912,3091,2953,3153,3170,3413,2998,3183,3249,3468
,3300,34
92,3533,3703,761,1124,1163,1533,1262,1599,1649,1
962,1280,1661,1709,1997,1770,2049,2106,2437,1350
,1734,18
11,2071,1851,2171,2144,2454,1871,2194,2248,2522,
2282,2534,2581,2849,1488,1834,1878,2170,1982,222
9,2259,2
545,1996,2283,2315,2596,2341,2617,2645,2922,2010
,2338,2376,2644,2439,2696,2735,2977,2480,2789,27
93,3033,
2840,3071,3106,3324,1510,1981,1990,2278,2011,231
2,2344,2624,2061,2398,2425,2674,2469,2732,2791,3
021,225
4,2438,2492,2736,2526,2803,2842,3068,2619,2843,2
913,3104,2954,3152,3169,3412,2314,2532,2602,2808
,2643,28
81,2932,3120,2699,2942,2979,3168,3020,3188,3264,
3471,2739,2999,3035,3248,3086,3267,3303,3494,312
2,3327,3
361,3515,3394,3597,3599,3771,1528,2017,2048,2427
,2228,2466,2481,2788,2265,2507,2535,2810,2611,28
60,2921,
3107,2319,2580,2641,2863,2672,2933,2980,3155,273
3,3006,2978,3181,3069,3251,3283,3478,2453,2647,2
691,295
2,2770,2982,3034,3204,2801,3040,3085,3280,3105,3
301,3334,3514,2880,3089,3124,3325,3171,3363,3395
,3569,31
89,3441,3470,3625,3493,3664,3666,3768,2527,2698,
2800,3041,2851,3084,3090,3302,2915,3126,3154,336
0,3182,3
392,3469,3598,2923,3180,3205,3440,3282,3476,3477
,3665,3332,3495,3513,3667,3535,3732,3734,3972,30
22,3266,
3281,3479,3335,3512,3532,3701,3393,3568,3596,373
3,3626,3735,3892,3974,3414,3624,3627,3769,3700,3
770,389
3,3975,3702,3894,3895,4020,3973,4021,4022,4023,1
28,129,130,199,131,248,251,412,196,250,297,444,32
8,477,47
9,718,197,296,298,476,331,498,543,734,378,542,518,
781,613,821,861,1098,198,329,377,516,379,541,563,
783,445,
595,615,832,705,876,905,1165,478,633,716,879,733,
926,979,1190,780,989,1015,1284,1030,1314,1372,16
69,249,3
30,414,594,446,614,704,863,496,717,634,906,773,95
7,1001,1217,540,707,775,988,793,1012,1029,1298,83
5,1048,1
108,1338,1164,1400,1454,1761,593,782,833,1028,87
7,1054,1115,1385,918,1156,1189,1414,1241,1483,15
40,1844,
991,1211,1287,1513,1312,1541,1593,1895,1357,1603
,1654,1937,1707,1984,2052,2386,299,413,447,706,49
9,732,7
35,1000,560,774,794,1027,860,1053,1083,1384,612,7
95,862,1055,904,1114,1186,1424,956,1187,1216,147
0,1297,1
537,1567,1875,654,874,919,1159,958,1188,1252,151
4,1026,1285,1313,1543,1356,1602,1635,1936,1082,1
331,1386 ,1619,1415,1691,1713,1976,1494,1742,180
2,2031,1852,2090,2191,2387,666,927,1003,1255,105
2,1299,1355,1617,
1099,1358,1402,1668,1455,1712,1760,2025,1184,142
5,1471,1740,1542,1794,1846,2108,1561,1854,1898,2
150,194
8,2208,2246,2559,1243,1515,1548,1817,1624,1874,1
905,2186,1706,1933,1977,2234,2032,2263,2351,2635
,1751,20
02,2053,2308,2088,2381,2421,2695,2189,2440,2463,
2686,2519,2762,2845,3108,376,497,517,792,561,820,
872,111
3,562,873,907,1166,976,1240,1256,1565,635,916,977
,1259,1013,1296,1329,1566,1031,1328,1373,1653,14
26,1705,
1720,1971,664,1002,1049,1269,1110,1336,1387,1704
,1158,1412,1456,1724,1482,1790,1825,2086,1157,14
80,1517,
1789,1560,1847,1885,2151,1626,1907,1949,2207,200

1,2245,2311,2607,719,1097,1111,1404,1171,1468,1516,1762,1191,1539,1547,1845,1594,1894,1932,2203,1359,1586,1625,1897,1670,1942,2000,2236,1746,2005,2074,2302,2111,2380,2423,2676,1459,1664,1725,1970,1788,2030,2076,2360,1830,2101,2117,2385,2200,2447,2501,2741,1899,2190,2209,2488,2237,2530,2459,2775,2330,2604,2636,2867,2655,2945,2994,3158,772,1167,1185,1551,1337,1601,1634,1906,1405,1652,1671,1957,1743,2007,2055,2364,1457,1741,1765,2024,1816,2077,2113,2389,1855,2121,2179,2443,2235,2491,2558,2779,1564,1791,1824,2112,1884,2164,2219,2460,1956,2224,2247,2550,2331,2515,2623,2875,2029,2294,2370,2605,2402,2654,2682,2928,2456,2693,2692,2974,2776,3017,3053,3253,1655,1853,1928,2225,2006,2262,2310,2569,2075,2361,2382,2637,2433,2665,2687,2939,2114,2413,2461,2677,2502,2694,2777,3018,2568,2805,2834,3062,2890,3118,3146,3349,2206,2489,2542,2778,2622,2796,2886,3077,2634,2877,2930,3136,2966,3173,3234,3418,2666,2956,3012,3197,3038,3239,3215,3448,3102,3277,3309,3510,3371,3550,3575,3690,415,519,592,834 ,632,917,978,1253,655,990,1014,1258,1051,1316,1330,1688,665,1050,1096,1315,1112,1469,1495,1750,1208,1512,1550,1831,1600,1888,1929,2233,667,1109,1170,1481,1210,1549,1587,1862,1254,1616,1644,1934,1690,1985,2027,2268,1286,1665,1715,2004,1763,2054,2091,2348,1795,2087,2126,2412,2149,2442,2490,2847,875,1209,1242,1595,1268,1645,1689,1959,1339,1721,1747,2035,1801,2103,2120,2366,1403,1749,1819,2089,1861,2148,2157,2430,1896,2158,2178,2500,2291,2531,2590,2876,1458,1860,1892,2167,1939,2218,2232,2510,1987,2290,2325,2565,2384,2614,2652,2931,2034,2350,2403,2653,2457,2671,2743,2967,2539,2748,2812,3019,2835,3065,3130,3341,878,1257,1317,1714,1401,1748,1803,2110,1427,1828,1863,2159,1904,2188,2201,2503,1538,1893,1938,2202,1986,2285,2309,2560,2033,2334,2383,2633,2431,2667,2718,2936,1592,1958,2026,2324,2100,2371,2367,2668,2115,2420,2441,2702,2511,2746,2772,3025,2187,2458,2537,2763,2561,2819,2844,3078,2595,2874,2902,3137,2973,3177,3235,3419,1627,2043,2102,2422,2156,2446,2514,2749,2271,2538,2584,2830,2587,2846,2888,3117,2295,2585,2594,2885,2669,2897,2961,3172,2728,2972,3003,3208,3052,3256,3290,3455,2335,2683,2716,2937,2773,2975,3016,3221,2813,3044,3079,3276,3131,3312,3357,3521,2904,3081,3140,3319,3187,3373,3386,3573,3224,3405,3445,3600,3486,3644,3687,3803,959,1354,1413,1829,1536,1889,1935,2244,1546,1943,2003,2287,2042,2329,2388,2719,1618,2028,2109,2365,2127,2445,2432,2740,2165,2462,2518,2804,2570,2826,2853,3103,1764,2116,2166,2444,2270,2509,2543,2831,2286,2571,2589,2866,2615,2889,2909,3164,2300,2606,2664,2908,2725,2960,2995,3209,2766,3029,3045,3257,3080,3291,3338,3502,1800,2269,2284,2564,2301,2586,2632,2896,2349,2670,2703,2944,2747,2990,3039,3247,2536,2724,2774,3002,2814,3063,3094,3278,2891,3095,3141,3320,3196,3372,3381,3572,2588,2818,2884,3064,2905,3133,3166,3340,2963,3176,3211,3380,3246,3410,3454,3607,3013,3225,3261,3444,3308,3459,3499,3652,3348,3511,3543,3675,3560,3725,3739,3869,1818,2303,2328,2717,2508,2742,2767,3028,2551,2797,2827,3076,2887,3116,3159,3339,2591,2852,2903,3119,2938,3167,3214,3377,2991,3238,3210,3401,3279,3449,3485,3618,2729,2929,2957,3186,3024,3220,3260,3424,3061,3268,3297,3464,3321,3487,3524,3674,3132,3313,3356,3503,3387,3551,3561,3709,3411,3589,3606,3753,3645,3774,3782,3848,2815,2962,3060,3269,3109,3296,3318,3498,3147,3370,3376,3542,3404,3552,3601,3738,3165,3400,3425,3588,3484,3610,3611,3775,3520,3653,3661,3783,3691,3820,3834,3924,3252,3458,3465,3619,3525,3660,3686,3793,3553,3708,3724,3821,3766,3835,3886,3990,3574,3752,3767,3849,3792,3868,3887,3991,3802,3906,3907,4034,3925,4035,4058,4059,652,653,822,1025,823,1080,1169,1452,924,1168,1219,1518,1318,1563,1585,1994,925,1218,1270,1562,1353,1646,1745,2022,1406,1744,1722,2079,1843,2125,2177,2486,1024,1319,1375,1666,1407,1727,1793,2085,1519,1841,1873,2152,1969,2216,2239,2549,1584,1887,1992,2227,2021,2288,2327,2592,2078,2333,2391,2680,2428,2720,2764,3031,1081,1352,1492,1840,1544,1872,1968,2185,1632,1993,1890,2260,2041,2293,2355,2629,1726,1979,2073,2332,2119,2368,2415,2704,2155,2434,2496,2750,2548,2784,2832,3101,1827,2084,2153,2414,2217,2476,2517,2781,2274,2528,2579,2816,2631,2865,2906,3162,2353,2621,2685,2879,2706,2907,2959,3217,2759,2971,3014,3241,3055,3274,3328,3544,1271,1453,1545,1978,1647,2020,2023,2354,1766,2072,2122,2401,2176,2451,2479,2780,1842,2123,2184,2477,2238,2516,2576,2824,2292,2577,2628,2856,2701,2899,2949,3199,1930,2210,2275,2541,2304,2578,2648,2892,2400,2681,2707,2911,2758,2970,3001,3240,2478,2731,2782,2987,2817,3049,3057,3272,2872,3082,3142,3311,3178,3350,3421,3545,1950,2289,2363,2651,2450,2705,2757,2985,2487,2760,2786,3030,2833,3056,3100,3299,2566,2825,2857,3074,2910,3134,3174,3358,2927,3184,3222,3388,3254,3430,3452,3635,2639,2893,2918,3145,2988,3198,3227,3408,3054,3233,3273,3438,3314,3457,3519,3677,3099,3288,3329,3490,3346,3537,3557,3711,3417,3566,3591,3704,3617,3736,3777,3878,1374,1633,1667,2118,1767,2124,2204,2513,1792,2205,2261,2556,2306,2630,2656,2947,1891,2272,2307,2659,2369,2700,2727,2948,2429,2726,2765,3011,2828,3051,3066,3271,1940,2362,2435,2679,2498,2744,2783,3050,2540,2806,2836,3072,2864,3128,3151,3344,2529,2858,2895,3115,2926,3175,3201,3389,2992,3229,3255,3429,3287,3451,3497,3663,1995,2485,2499,2798,2563,2854,2894,3110,2593,2901,2917,3163,2964,3216,3232,3427,2761,2950,2989,3219,3036,3244,3286,3446,3092,3293,3336,3488,3365,3536,3559,3696,2839,3026,3073,3270,3114,3310,3342,3522,3160,3353,3375,3541,3422,3581,3603,3723,3223,3420,3431,3592,3447,3620,3585,3745,3506,3658,3678,3785,3683,3819,3838,3900,2040,2557,2567,2925,2745,2969,3000,3228,2799,3010,3037,3259,3083,3295,3331,3526,2837,3075,3113,3298,3144,3343,3367,3547,3185,3379,3407,3577,3439,3595,3634,3749,2946,3129,3150,3366,3200,3398,3433,3586,3258,3434,3453,3632,3507,3615,3671,3787,3307,3480,3530,3659,3548,3682,3698,3810,3582,3707,3706,3832,3746,3845,3859,3935,3015,3179,3230,3435,3294,3456,3496,3641,3337,3523,3538,3679,3565,3685,3705,3817,3368,3555,3587,3697,3604,3710,3747,3846,3640,3755,3772,3862,3798,3882,3898,3963,3428,3593,3630,3748,3670,3750,3794,3867,3676,3789,3812,3890,3828,3909,3928,3986,3688,3822,3842,3915,3854,3931,3921,3994,3876,3943,3951,4010,3967,4018,4031,4054,1493,1723,1826,2154,1886,2273,2326,2649,1931,2352,2390,2658,2449,2722,2730,3046,1941,2448,2484,2721,2512,2855,2873,3098,2612,2878,2924,3161,2968,3202,3231,3437,1951,2497,2562,2859,2620,2919,2951,3194,2650,2984,3008,3236,3048,3275,3305,3460,2684,3027,3059,3292,3111,3330,3351,3516,3135,3345,3382,3554,3385,3576,3594,3779,2211,2613,2638,2965,2678,3009,3047,3263,2751,3067,3093,3317,3139,3355,3378,3528,2787,3097,3149,3347,3193,3384,3391,3562,3218,3396,3406,3602,3475,3621,3654,3788,2838,3192,3212,3403,3243,3432,3436,3612,3285,3474,3501,3639,3540,3668,3680,3813,3316,3518,3549,3681,3583,3695,3727,3829,3629,3730,3756,3847,3773,3865,3884,3961,2226,2657,2723,3058,2785,3096,3143,3364,2829,3156,3195,3397,3226,3416,3423,3605,2900,3213,3242,3426,3284,3467,3491,3636,3315,3508,3539,3673,3563,3689,3716,3814,2958,3262,3304,3500,3352,3531,3529,3692,3369,3556,3567,3712,3613,3728,3742,3851,3409,3584,3623,3737,3637,3761,3776,3870,3657,3786,3804,3891,3831,3911,3929,3987,2993,3323,3354,3558,3390,3580,3614,3731,3463,3628,3646,3764,3649,3778,3796,3881,3481,3647,3656,3791,3693,3801,3825,3908,3720,3830,3841,3916,3858,3936,3946,3997,3509,3699,3714,3815,3743,3833,3844,3923,3757,3856,3871,3942,3885,3952,3965,4013,3806,3873,3896,3955,3913,3969,3978,4029,3926,3983,3993,4036,4004,4044,4053,4075,2305,2756,2807,3157,2898,3203,3237,3450,2916,3245,3289,3473,3322,3505,3546,3717,2986,3306,3359,3527,3383,3579,3564,3722,3399,3590,3616,3754,3642,3762,3781,3877,3112,3374,3402,3578,3462,3609,3631,3765,3472,3643,3651,3784,3669,3797,3809,3902,3482,3662,3684,3808,3719,3824,3839,3917,3740,3853,3857,3937,3872,3947,3958,4008,3138,3461,3466,3638,3483,3648,3672,3800,3517,3694,3713,3818,3729,3836,3855,3933,3622,3718,3744,3840,3758,3863,3874,3944,3799,3875,3897,3956,3914,3968,3977,4028,3650,3760,3790,3864,3807,3889,3904,3960,3827,3910,3919,3976,3932,3984,3996,4039,3843,3927,3939,3992,3950,3999,4007,4046,3962,4011,4017,4051,4026,4061,4063,4083,3148,3489,3504,3715,3608,3726,3741,3852,3633,3751,37 63,3866,3795,3880,3901,3959,3655,3780,3805,3883,3816,3905,3920,3971,3837,3930,3918,3981,3945,3995,4003,4042,3721,3811,3823,3912,3850,3922,3938,3988,3861,3940,3949,4000,3957,4005,4014,4050,3888,3953,3964,4009,3979,4019,4027,4057,3985,4033,4038,4065,4045,4068,4070,4080,3759,3826,3860,3941,3879,3948,3954,4006,3899,3966,3970,4016,3982,4024,4037,4062,3903,3980,3989,4032,4002,4040,4041,4069,4012,4047,4049,4071,4055,4076,4078,4088,3934,3998,4001,4043,4015,4048,4052,4073,4025,4056,4060,4077,4066,4079,4084,4090,4030,4064,4067,4081,4072,4082,4085,4091,4074,4086,4087,4092,4089,4093,4094,4095]

**Sequence group 2: Q2_8192**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,1024,1025,160,520,288,528,192,544,70,44,131,81,50,73,15,320,133,52,23,134,384,76,137,82,56,27,97,39,259,84,138,145,261,29 ,1026,1028,43,98,515,88,140,30,146,71,262,265,161,576,45,100,640,51,148,46,75,266,273,517,104,162,1032,1040,53,193,2048,2049,2050,2052,152,77,164,768,268,274,518,54,83,57,521,112,135,78,289,194,85,276,522,58,1056,1027,168,139,99,86,60,280,89,290,529,524,196,141,101,147,1029,1088,176,142,530,321,31,200,90,545,292,322,532,263,149,102,105,304,296,163,92,47,267,385,1033,1030,546,324,2056,2064,2080,2051,208,386,150,153,165,106,55 ,328,536,577,548,113,154,79,1041,1034,269,108,578,224,166,519,552,195,270,641,523,275,580,291,1042,1152,59,169,560,114,277,156,87,197,116,170,61,531,525,642,1036,1057,2053,2112,2057,2054,281,278,526,177,4096,4097,4098,4100,4104,4112,4128,4099,293,388,91,584,1089,1044,769,198,172,120,201,336,62,282,1280,1058,143,103,178,294,93,644,202,592,323,392,1048,1060,297,770,107,180,151,209,284,648,1031,1153,94,204,2065,2058,2066,2176,298,400,608,352,325,533,155,210,305,547,300,109,1090,1536,184,534,537,115,167,225,326,306,1035,1064,772 ,157,656,329,2060,2081,2113,2068,110,117,212,171,1092,1154,776,330,226,549,538,387,308,216,1043,1037,416,271,279,158,1072,1038,337,550,672,118,332,579,540,389,173,121,553,199,784,179,228,338,312,704,1096,1281,390 ,174,2304,2082,2072,2084,554,581,1045,1156,4101,4160,4105,4102,4113,4106,4114,4224,393,283,122,448,353,561,1059,1282,203,63,340,394,527,582,556,181,295,285,232,124,205,182,643,562,286,585,1050,1537,2055,2177,2114,2560,299,354,1104,1061,211,401,185,396,1049,1046,344,586,645,593,535,240,206,95,327,564,800,402,1160,1284,356,307,301,417,2059,2088,2116,2178,1288,1062,213,568,832,588,186,646,404,227,896,594,418,302,1538,1120,649,771,360,539,1091,1065,1168,1052,111,331,214,309,2067,2061,2096,2062,4108,4129,4161,4116,4352,4130,4120,4132,188,449,217,408,609,596,551,650,1093,1066,229,159,420,310,1540,1073,2120,2305,2069,2180,541,773,1098,1296,610,657,333,119,600,339,218,368,652,230,391,313,2083,2306,2074,2561,450,542,1184,1544,334,233,555,774,175,123,658,612,1312,1552,341,777,220,314,1216,1568,2128,2085,2073,2070,424,395,673,583,1094,1068,355,287,183,234,1155,1105,125,557,660,616,2184,2308,2312,2086,1074,1097,1039,1344,4103,4225,4162,4608,4107,4136,4164,4226,342,316,241,778,563,345,452,397,1157,1076,1047,1158,403,207,674,558,785,432,357,187,236,664,624,587,2562,2144,2115,2089,1408,1100,780,705,126,242,565,398,1161,1106,346,456,358,405,1080,1051,2192 ,2076,2117,2090,1121,1063,303,569,244,595,189,566,4115,4109,4144,4110,4168,4353,4117,4228,676,361,706,589 ,215,786,647,348,2564,2097,2122,2320,419,406,464,680,801,362,1283,1108,590,409,1162,1169,1285,1053,570,788,3072,3073,2208,2568,597,572,219,311,1067,1122,1539,1112,2336,2576,2240,2592,708,598,601,651,421,792,802 ,611,1164,1054,602,410,1170,1095,231,688,653,248,369,190,364,654,659,335,1286,1289,480,315,221,370,1185,1600,1069,1124,613,422,2118,2092,2179,2129,425,451,1664,1075,4131,4354,4122,4609,4176,4133,4121,4118,614,543,235,412,2098,2121,2063,2368,343,372,1172,1070,775,317,222,426,1099,1290,453,237,2181,2100,2071,2182,559,833,804,712,1297,1541,1128,1186,834,661,808,779,1077,1217,617,604,1176,1101,433,720,816,836,347,897,1188,1792,1292,1298,243,662,454,318,675,618,1542,1078,2432,2124,2185,2130,4232,4356,4360,4134,4610,4192,4163,4137,898,781,376,428,2104,2075,2145,2087,1107,1081,665,736,567,840,625,238,2307,2132,2186,2193,1545,1136,1159,1102,359,457,1313,1218,399,787,591,678,110

9,1300,434,677,349,245,458,666,620,363,127,191,23
09,2077,
3074,3076,782,407,1546,1082,1192,1163,436,626,42
40,4124,4165,4138,4612,4145,4170,4368,2091,2146,
2563,213
6,571,465,1123,1110,681,246,707,350,1084,1304,599
,668,790,460,1113,1314,249,682,573,411,803,789,70
9,365,21
88,2078,2194,2119,1553,1548,1220,1165,440,628,68
9,374,2310,2313,2209,2624,2093,2148,2688,2099,42
3,466,79
3,250,1125,1171,1200,1166,5120,5121,4256,4616,43
84,4624,4288,4640,1554,1345,1055,1224,371,481,57
4,413,11
14,1569,1316,1346,603,366,468,655,2196,2094,2123,
2314,900,805,615,684,1556,1287,710,429,2321,2565,
2152,22
10,4166,4140,4227,4177,4146,4169,4111,4416,1173,
1126,794,252,3080,3088,2101,2241,1129,1328,373,6
05,848,6
90,713,632,1320,1187,482,806,1116,1071,427,904,12
91,1409,414,223,663,692,1570,1348,4229,4148,4119,
4230,44
80,4172,4233,4178,835,619,1232,1410,2200,2125,22
12,2816,472,455,796,809,1174,1177,1189,1130,714,7
21,837,7
16,864,810,606,912,2316,2322,2566,2102,1079,1352,
722,696,377,435,817,319,2131,2105,2569,2160,4152,
4123,41
93,4135,4355,4180,4234,4241,1560,1601,621,812,15
72,1137,484,430,2183,2126,2337,2242,1178,1103,12
93,1132,
838,667,488,239,2133,2324,2570,2106,378,459,1602,
1248,1190,1543,1576,1219,4357,4125,5122,5124,413
9,4194,
4611,4184,3104,3075,2216,2187,2147,2134,2108,232
8,622,627,437,380,1294,1665,1547,1299,818,461,496
,669,67
9,724,841,629,2137,2338,2577,2572,2244,2189,2149,
2195,351,467,1604,1315,1083,1193,438,737,1584,11
38,251,4
62,442,441,469,247,1301,1180,683,842,1111,1221,11
40,1194,4236,4126,4242,4167,4358,4361,4257,4672,
3077,31
36,2224,2190,738,899,670,783,1085,1555,1549,1666,
849,820,1305,1302,2578,2369,2079,2248,728,928,15
50,1201,
791,367,901,630,2138,2593,2340,2370,4141,4196,47
36,4147,4244,4142,4171,4362,2580,2311,2197,2150,
1317,141
2,685,844,633,711,1115,1608,1793,1222,1196,1144,1
225,1360,253,691,1086,1306,824,902,686,740,850,37
5,444,4
70,483,415,4369,4613,4200,4258,5128,5136,4149,42
89,1167,1127,1202,1318,1117,1668,1226,1616,485,9
05,1347,
1416,2153,2352,2344,2211,795,473,1321,1794,2140,
2095,2315,2433,3081,3078,2594,2372,634,744,852,9
60,6144,
6145,6146,6148,4248,4173,4260,4864,1131,1204,865
,693,1175,1233,797,906,2256,2434,2198,2201,2213,2
154,210
3,2376,4364,4370,4614,4150,4179,4153,4617,4208,1
308,1672,715,807,1118,1228,474,636,1322,1424,163
2,1376,6
94,254,717,575,2584,2625,2596,2161,913,798,1349,1
557,2202,2127,3089,3082,1179,1234,1329,1571,1324
,1133,8
11,379,1208,1558,697,431,607,489,1561,1139,866,72
3,486,908,2317,2156,2626,2272,718,813,476,856,119
1,1249,
1350,1330,2214,2567,2600,2243,2318,2689,2571,232
3,839,725,1796,1181,4231,4174,4385,4290,4181,437
2,4618,4
154,1680,1353,698,914,2628,2339,3090,3200,752,86
8,1134,1141,819,814,1236,1195,5152,5123,4264,423
5,4195,4
182,4156,4376,1800,1354,1250,1573,2107,2217,2608
,2162,1562,1411,1332,1240,439,929,490,623,2325,22
04,2135 ,2245,671,739,916,463,4185,4386,4625,4620
,4292,4237,4197,4243,843,381,1440,1295,1303,1182,
1361,1574,2164,
2218,2109,2579,2573,2690,3084,3105,497,930,1696,
1142,821,726,961,872,2329,2326,2574,2225,1356,16
03,492,6
31,2341,2436,2139,2632,1564,1413,1197,1145,729,7
00,443,741,1577,1223,1808,1203,3137,3092,2817,22
46,2220,
2168,2249,2384,1252,1362,845,920,1336,1728,382,8
22,1414,1198,851,730,2110,2330,3328,3106,5125,51
84,4272,
4238,4626,4417,4127,4296,1578,1605,1417,1307,498
,880,1146,1472,4186,4641,4388,4418,4628,4359,424
5,4198,2
191,2151,2226,2342,742,445,471,635,932,687,1377,1
585,903,825,1227,1087,4201,4400,4392,4259,4188,4
143,436
3,4481,2141,2692,2250,2640,2371,2440,3096,3108,1
364,1418,500,846,2345,2818,2155,2228,745,826,155
1,1606,1
580,1205,1319,1309,2199,2257,2332,2696,732,446,1
256,1148,1229,1206,1667,1586,962,936,475,853,867,
637,131
0,1609,1323,1378,1235,1425,5129,5126,4642,4420,6
152,6160,6176,6147,907,487,695,746,3079,3201,214
2,2252,2
346,2448,2656,2400,828,753,1209,1420,4304,4482,4
246,4249,4261,4202,4151,4424,1368,1610,854,857,2
373,2581 ,2203,2258,1669,1617,1559,1264,1230,111
9,504,799,2353,2595,2348,2157,255,964,1351,1588,1
824,1426,1380,13
31,3138,3584,2232,2582,909,719,477,915,1325,1441,
638,748,944,869,1237,1592,491,699,1856,1612,4632,
4673,46
44,4209,4250,4175,5137,5130,2585,2163,2215,2273,
2374,2354,3083,3112,754,858,1210,1670,1428,1251,478,968,
4365,4204,4674,4320,4262,4615,4648,4291,4366,473
7,4619,4371,4676,4387,5138,5248,1920,1618,1442,1
326,167
3,1795,383,910,2820,2205,2704,2377,2158,2165,226
0,2219,3140,3202,2824,2378,2274,2597,2586,2435,1
384,1563 ,1135,1355,815,976,870,917,2356,2264,309
1,3085,2464,2319,2327,2206,727,493,1238,1333,873,
701,1212,1473,41
55,4265,4656,4210,4373,4252,4183,4293,1241,1432,
931,756,1633,1620,1575,1674,3120,3086,2385,2598,
860,499,
1253,1183,4212,4266,4157,4627,4621,4738,5132,515
3,2720,2166,2380,2627,1444,1334,1565,1797,6149,6
208,615
3,6150,4377,4374,4622,4273,2588,2437,2221,2169,7
31,823,922,874,1634,1681,918,502,1357,1143,1624,1
363,260
1,2247,2832,2227,933,743,1242,1392,2276,2386,236
0,2752,760,881,1676,1254,3144,3329,2438,2222,141
5,1337,1
474,1566,1358,1257,494,702,2602,2629,3093,3204,1
579,1798,921,501,2441,2331,2170,2496,4389,4484,4
187,4680 ,5185,5140,4865,4294,1199,1147,1682,163
6,1365,1801,876,847,2401,2609,3107,3330,2251,211
1,2388,2442,992,4
47,1244,1338,733,827,1448,1419,934,882,1697,1607,
937,963,1379,1311,4268,4216,4297,4432,4158,4378,
5376,51
54,2575,2630,2604,2229,1207,1258,1149,1581,747,5
05,855,924,1684,1640,1366,1340,4239,4199,4274,43
90,4189,
4740,4298,4688,2343,2333,2280,2172,1265,1802,734
,829,2253,2230,2691,2610,1587,1369,1476,1421,441
9,4488,5
144,5156,4393,4866,4203,4276,2334,2633,3098,3585
,2347,2402,3152,3109,965,938,1427,1231,1698,1582,
1809,14
56,4247,4305,4380,4744,5127,5249,4190,4300,884,5
06,1381,1211,2259,2449,2233,2444,3097,3094,2392,
2634,269
3,2641,2583,2288,6161,6154,6162,6272,4394,4496,4
704,4448,4421,4629,4251,4306,4401,4643,4396,4205
,749,945 ,1260,1688,1648,1611,966,755,2254,2143,2
375,2612,2848,2450,3208,3332,859,940,1804,1729,1
150,1266,1589,14
22,1370,1480,830,911,871,639,1382,1429,5186,5632,
4280,4630,4633,4211,4263,4321,4422,4402,5131,516
0,4868,
4253,4752,4425,1327,1593,1268,1619,2404,2355,234
9,2465,3336,3110,2261,2616,888,479,1213,1590,288
0,2636,2
234,2694,1700,1385,1730,1613,946,750,1239,1810,1
671,1372,1443,1430,2452,2275,2944,2642,1488,1704
,969,508 ,2466,2350,3586,3168,2697,2819,2408,2587
,6156,6177,6209,6164,4206,4213,4308,4267,861,757,
1825,1386,970,9
19,1614,1433,3139,3113,3216,3100,2159,2379,2262,
2357,875,862,1594,1812,2236,2497,2265,2456,5188,
5250,487
2,4426,4322,4645,4634,4483,1621,1596,758,948,265
7,2644,2599,2698,1243,1335,1732,1622,1625,1675,1
445,1816 ,4404,4312,5139,5133,4512,4367,4375,425
4,5168,5134,4433,4646,4768,4214,4428,4675,3141,3
114,2277,2207,977 ,923,1826,1635,972,761,1626,143
4,2468,2358,3588,3121,2589,2821,3146,3344,2658,2
705,2381,2167,2648,2387,2
266,2416,1255,1712,877,952,2700,2278,2439,2361,1
677,1272,495,703,1393,1214,1388,1678,935,978,168
3,1359,1
504,1339,1245,1394,1637,1446,1449,1475,2498,2590
,3232,3592,2382,2281,2603,2822,2223,2171,2706,26
60,3360,
3600,2389,2825,1638,1567,1259,1436,2268,2362,326
4,3616,4636,4485,4269,4217,4649,4295,4880,4275,8
83,762,1
367,1396,2472,2443,2721,2631,4324,4434,4408,4800
,5192,5377,4486,4270,6400,6178,6168,6180,4650,46
77,5141,
5252,503,925,1799,1341,1246,1450,878,735,3142,31
16,2403,2335,1477,1261,993,885,2231,2282,3203,31
53,1583,
1857,1828,1736,4489,4379,4218,4544,4449,4657,515
5,5378,4299,4159,4436,4490,4623,4678,4652,4277,2
173,260
5,2708,2664,939,994,1858,1685,3122,3145,3087,339
2,1832,1803,1641,1628,2390,2364,2289,2826,2611,2
393,2500 ,2445,1457,1744,1840,1860,980,926,764,94
1,4391,4381,4328,4220,4301,4278,4739,4658,1371,1
921,1267,1686,32
05,3124,3095,3206,4382,4681,5146,5633,6151,6273,
6210,6656,2451,2255,2722,2606,2833,2480,2405,223
5,2284,2
712,2672,2635,1478,1342,967,886,3456,3148,2828,2
753,1699,1642,831,947,1922,1805,1400,1452,2174,2
290,2613 ,2446,1689,1760,507,889,1591,1864,1649,1
262,4395,4450,5200,5157,4307,4497,4281,4492,984,
751,1383,1481,94
2,996,1423,1811,3209,3154,2394,2504,2406,2453,31
28,3099,5145,5142,4440,4682,4741,4689,4631,4336,
4302,419
1,4423,4660,4896,4498,5256,5380,1615,1702,1458,1
701,3169,3111,2351,2617,2292,2643,2237,2614,1373
,1269,14
82,1690,4452,4403,4397,4513,6155,6184,6212,6274,
1644,1387,971,890,2724,2409,2754,2637,1151,1215,
1806,143
1,2263,2834,2695,2396,2467,2454,2512,2728,2849,2
410,3331,3156,5384,5158,4309,4664,4928,4684,4282
,4742,26
38,2457,3210,3217,3333,3101,2618,2836,1460,1650,
509,949,973,1000,1595,1489,4500,4323,4992,4690,4
514,4398 ,5634,5216,1705,1270,1731,1374,892,950,1
623,1692,1814,1484,1273,1706,2645,2620,2267,2359
,3115,3170,3587,
3160,2756,2646,2649,2699,4745,4867,4456,4635,518

7,5161,5264,5148,4207,4427,4310,4405,6163,6157,6192,615 8,863,759,1008,510,2469,2840,2850,2659,1597,1435,1827,1813,1733,1389,1464,1652,4284,4545,4313,4504,4705, 4692,4647,4746,3212,3102,2650,2458,1713,1398,1447,1490,5189,5162,4325,4255,4516,4406,5636,5169,3218,314 3,2279,2736,2701,2296,2417,2238,979,953,1817,1274,1395,1505,1598,1437,2412,2702,2707,2383,3334,3337,2528 ,2363,6216,6401,6165,6276,4637,4869,5194,5392,4706,4753,4429,4215,4696,4435,4314,4464,2269,2418,3233,364 8,763,974,1627,1390,3117,3172,2661,2470,1492,1679,954,879,2473,2499,3712,3123,1924,1829,981,982,4748,432 6,4487,4409,6179,6402,6170,6657,2662,2591,2283,2460,2391,2420,3220,3118,1639,1708,1734,1453,2823,2365,22 70,2474,4546,4638,5280,5640,4430,4329,4651,4870,1818,1276,927,995,1397,1629,1872,1714,1737,1656,1506,183 0,3147,3338,2501,2285,1451,1928,1438,1247,2607,2881,2852,2760,4271,4219,4754,4708,5408,5648,4437,4873,43 16,4410,5312,5664,6224,6181,6169,6166,3345,3589,3176,3234,1687,1716,1859,1643,4520,4491,4769,4679,5190,5 164,4451,4383,1496,1479,1820,1833,2882,2709,2856,2827,3125,3265,2665,2652,3224,3149,2481,2768,4279,4330, 5251,5201,4221,4653,4756,4712,765,956,1738,1745,2864,2884,2395,2945,3236,3840,3340,3346,2291,2710,2502,2 366,1861,1740,1888,1834,887,985,1630,1936,1746,1720,1401,1459,2723,2666,3590,3126,2946,2829,2424,2476,31 55,3129,2713,2784,997,986,1841,1343,1645,1836,1508,1454,6280,6404,6408,6182,5170,5193,5135,5440,4438,441 2,4337,4874,4659,4441,4548,4493,1862,1691,943,891,2615,2888,2673,2286,3593,3184,3207,3150,1512,1263,1402 ,1483,5253,5172,5143,5254,4499,4303,4770,4654,2407,2505,3361,3266,2447,2835,2639,2726,3157,3348,2482,272 5,1646,1651,1461,1404,4881,4528,4453,4283,4332,4760,4720,4683,1842,1485,998,766,2397,2293,2506,2714,2668 ,2411,2175,2239,2830,2455,3594,3130,6658,6240,6211,6185,5504,5196,4876,4801,1520,1693,511,988,1703,1748, 1865,1653,3240,3211,2484,2674,1375,1491,1462,1761,1275,1486,1466,1465,2619,2513,3171,3158,1001,951,1493, 1271,2729,2294,2755,2398,4222,4338,4661,4494,5257,5202,4442,4552,4454,4501,5176,5147,6288,6172,6213,618 6,1707,1866,1762,1923,3132,3352,2647,2716,2838,2508,3161,3362,1694,1807,1873,1844,2297,2730,2621 ,2459,28 51,2837,2757,2413,3601,3596,3268,3213,1752,1952,1815,1391,5217,5159,4399,4665,4340,4691,4285,4662,4772,4 457,4802,4685,4311,4882,4743,4444,6660,6193,6218,6416,4515,4502,4560,4776,4897,4458,5379,5204,4686,4505, 5258,5265,2488,2676,2737,2422,2471,2514,2841,2298,1002,893,1925,1654,1709,1868,1657,1735,5381,5149,4666, 4884,7168,7169,6304,6664,4693,4668,4315,4407,5163,5218,5635,5208,1277,1715,975,894,3173,3219,3248,3214,1 848,1926,1710,1764,3602,3393,3103,3272,2419,2529,2622,2461,1874,1399,1468,1494,3162,3617,3364,3394,2651, 2414,2516,2703,6432,6672,6336,6688,4804,4694,4697,4747,1507,1439,1509,1929,2948,2853,2663,2732,4517,488 8,4898,4707,5260,5150,4698,4506,3604,3335,2758,2477,3221,3174,2842,2300,5266,5191,4327,4784,4749,4344,44 65,4286,1009,955,1819,1497,1658,1768,1876,1984,3177,3376,2421,2653,1889,1717,1821,1930,2896,2738,2761,26 80,3368,3235,2530,2854,4460,4750,4755,4431,5382,5385,4576,4411,1739,1831,1004,1010,3164,3119,2475,2952,4 317,4466,5281,5696,5165,5220,4709,4518,1498,1660,957,983,3339,3457,2462,2271,6214,6188,6275,6225,4521,45 47,5760,5171,2711,2740,3618,3396,2883,2667,3280,3458,2520,2503,2844,2857,1718,1278,1741,1599,4710,4639,4 331,4508,6194,6217,6159,6464,3222,3225,3237,3178,1937,1822,958,987,4439,4468,5268,5166,4871,4413,4318,45 22,2762,2769,2885,2764,2912,2858,2654,2960,3127,3400,2770,2744,1835,1403,1721,1455,5195,5386,4549,4333,6 277,6196,6167,6278,4655,4929,4900,4808,5393,5637,5224,5282,1631,1513,1890,1747,2425,2483,2865,2367,1012, 999,1510,1932,3608,3649,2669,2860,1742,1837,1500,1880,3620,3185,2532,2478,1863,1749,1016,767,3226,3151,3 341,3180,4930,4757,4904,4875,5173,5313,4713,4700,2886,2715,2536,2287,2426,2507,3650,3296,1722,1938,1776, 1892,1843,1838,1463,1953,3238,3591,3624,3267,2670,2675,2485,2428,5272,5197,4529,4816,4912,4932,4443,499 3,3342,3713,3595,3347,1514,1647,1695,1763,5284,5888,5388,5394,4339,4758,4550,4414,2866,2509,2544,2717,27 27,2772,2889,2677,4771,4714,5638,5174,6528,6220,6281,6226,4994,4877,4472,4524,6200,6171,6241,6183,1940,1 487,1867,1405,2399,2515,3652,3363,3131,3241,2486
,2785,3632,3186,2299,2510,989,1003,1521,1954,249
0,2489,2
517,2295,5203,5177,4761,4832,4663,4936,4721,4334
,6403,6228,6282,6289,5641,5232,5255,5198,4455,45
53,5409,
5314,4495,4883,4687,4774,1845,1750,1985,1896,334
9,3228,2731,2890,3159,3269,3188,3242,1516,1655,1
753,172
4,5205,5396,4530,4773,4445,4341,4554,4762,4716,4
459,4223,4287,6405,6173,7170,7172,1467,1765,990,
1005,278
6,2947,2718,2831,3133,3603,3597,3714,2897,2868,3
353,3350,2776,2976,3598,3249,1869,1944,1406,1846
,1875,17
54,1522,1904,2839,2415,2949,2678,3365,3460,2733,
2892,2681,2759,3163,3656,4878,4503,5642,5178,528
8,5259,4
532,4722,6187,6242,6659,6232,4667,4561,5219,5206
,1766,1469,1495,1659,3841,3270,3244,3192,4777,43
42,4803,
4446,5180,5400,4695,4764,3273,3408,2301,2739,313
4,3354,2872,2950,959,1011,1956,1711,2734,2788,28
98,2423,
2492,2518,2531,2463,3215,3175,3250,3366,4886,455
6,5209,5410,4345,4778,4669,4507,3165,3716,3274,3
664,192
7,1849,1524,1870,4899,4885,4805,4461,6284,6174,6
290,6215,5649,5644,5316,5261,4536,4724,4785,4470
,1769,18
50,1756,1470,2533,2953,3395,3464,1986,1960,1499,
1877,2843,2521,3369,3842,6406,6409,6305,6720,618
9,6244,6
784,6195,4519,4562,4889,4346,5221,5267,5296,5262
,1891,1661,1931,1511,2682,2792,2900,3008,5650,54
41,5151,
5320,4467,4577,4670,4509,3179,3252,2913,2741,101
3,895,1719,1770,5210,5665,5412,5442,4699,4462,45
64,4751,
3223,3281,2845,2954,3356,3720,2763,2855,3166,327
6,2522,2684,3370,3472,3680,3424,6292,6190,6219,6
410,499
6,4901,4711,4780,1852,1777,1878,1881,2742,2302,2
765,2623,1528,1823,1279,1988,2961,2846,3397,3605
,5652,53
83,4806,4525,6417,6661,6248,6306,5269,5222,4890,
4348,7176,7184,6197,6337,5225,5424,4469,4701,494
4,4786,4
809,4728,5416,5283,4578,4902,5212,5167,4523,5000
,3227,3282,3377,3619,1933,1743,1501,1939,5387,55
05,4510,
4319,4759,4788,5666,5444,3372,3181,2859,2427,166
2,1772,1006,1014,3256,3606,2745,2479,2655,2537,3
609,318
7,1968,1893,1515,1723,2914,2771,2534,2956,2766,2
861,2524,2904,3239,3297,3398,3378,2887,2773,3844
,3229,37
28,3401,2746,2962,4931,4715,5328,5506,6296,6221,
6308,6912,4568,4551,4892,4905,5270,5273,5285,522
6,4810,4
817,4933,4812,4960,4906,4702,5008,6412,6418,6662
,6198,5175,5448,4818,4792,2800,2916,3182,3189,28
67,2862,
3284,3243,4473,4531,4913,4415,6227,6201,6665,625
6,1778,1882,1502,1992,3848,3402,3298,3621,5656,5
697,471
7,4908,5668,5233,4580,4526,1407,1934,1839,2000,3
610,3459,3380,3288,2487,2977,2538,2671,1894,1941
,1017,10
18,6279,6222,6433,6338,5274,5199,5389,5228,2719,
2787,2964,2511,1751,1517,1897,1725,4934,4763,458
4,4335,6
229,6420,6666,6202,2891,2429,3488,3343,3351,3230
,3409,3622,4474,4555,5698,5344,5286,5639,5672,53
15,1955,
1780,1884,1523,2545,2978,3744,3190,7200,7171,631
2,6283,6243,6230,6204,6424,2869,2774,3009,2920,3
404,365
1,2540,2679,4718,4723,4533,4476,5390,5761,5643,5
395,4914,4557,4592,4765,4775,4820,4937,4725,3612
,3461,32
45,3193,2777,2748,2491,2789,1755,1847,1946,1898,
1942,1526,1957,1767,3625,3271,3856,3251,3300,341
0,2893,2
968,6233,6434,6673,6668,6340,6285,6245,6291,4447
,4563,5700,5411,5179,5289,4534,4833,5680,5234,43
47,4558,
4538,4537,4565,4343,5397,5276,4779,4938,5207,531
7,5236,5290,3384,3776,2430,2870,991,1020,1784,19
05,7173,
7232,6320,6286,4834,4995,4766,4879,3462,3246,289
9,2778,1518,1726,1945,1525,3626,3653,3465,3355,2
546,292
8,3194,3520,5181,5651,5645,5762,4945,4916,5401,5
398,2790,2493,2519,2683,1900,1871,2016,1471,2980
,2735,34
25,3633,2951,2873,3275,3135,1757,1851,1958,1906,
3412,3466,2548,2894,1961,1987,1771,1529,2793,287
4,3599,3
654,6674,6465,6175,6344,4824,5024,5646,5297,4887
,4463,4997,4726,6234,6689,6436,6466,3628,3253,33
67,3357,
2780,2494,3304,3196,6676,6407,6293,6246,5413,550
8,4781,4940,4729,4807,5211,5704,5889,5318,5292,5
240,327
7,3254,3715,3634,3010,2984,2523,2901,2915,2685,3
358,3657,1879,1948,1758,1853,5321,5456,4349,4787
,5182,54
02,4920,4998,3371,3426,3283,3473,2955,2535,2743,
2794,4782,4836,4946,4471,4540,4566,4579,4511,526
3,5223,5
298,5414,5213,5764,5322,5712,4581,5001,5443,5512
,6249,6448,6440,6307,4891,4569,5417,5890,6236,61
91,6411,
6529,7177,7174,6690,6468,4730,4840,4948,5056,287
6,2801,3257,3468,1989,1962,1908,1530,1773,1969,1

990,177
9,3416,3658,2902,2905,3717,3665,3607,3312,3278,3
167,2552,2847,1883,1964,1854,1935,2303,3012,3399
,3636,38
72,3474,3428,3379,2957,2767,2525,2963,5227,5300,
4961,4789,5271,5329,4893,5002,6352,6530,6294,629
7,6309,6
250,6199,6472,5404,5768,4811,4903,5214,5324,4570
,4732,1895,1663,1912,1503,1970,1774,1993,1532,54
18,5520,
5728,5472,4790,4350,4813,4671,3373,3489,2686,279
6,2992,2917,3285,3640,2539,2747,3904,3660,2802,2
906,325
8,3718,6680,6721,6692,6257,5009,4894,5445,5653,3
476,3299,2526,3016,3968,3666,3490,3374,6298,6223
,7185,71
78,5275,5330,5425,5667,5420,5229,4907,4475,5304,
5654,4793,4527,1885,1781,1994,1943,3721,3843,243
1,2958,3
432,3611,3183,3403,2863,3024,2918,2965,4703,4585
,5657,5235,4962,4819,4582,5004,6413,6252,6722,63
68,4814,
4909,4572,4952,5287,5345,5446,5426,6310,6663,669
6,6339,1899,1886,1782,1972,2775,2541,3286,3381,6
414,678
5,6667,6419,4935,4821,5892,5277,2921,2749,3260,3
521,2001,1947,1996,1785,5776,5449,4794,5010,6724
,6435,71
86,7296,3289,3480,2979,2804,1901,1976,1519,1727,
4848,4964,5230,5237,4915,4910,5332,5291,5896,545
0,5346,5
669,6203,6313,6704,6258,3681,3668,3623,3722,2908
,2547,3301,3231,5658,5507,5428,5336,4535,5025,45
86,4719,
3492,3382,3613,3845,1959,2002,1007,1015,2779,287
1,2970,2922,3682,3729,2966,2550,3405,3191,3672,3
411,298
1,2791,3290,3440,6421,6300,6231,6341,4767,4835,5
012,4559,2808,2929,3724,3302,3463,3385,3522,3614
,4939,44
77,5536,5391,5399,5278,5457,5670,6260,6314,6205,
6675,6669,6786,7180,7201,3406,3305,2542,2750,362
7,3846,2
969,2549,3247,3195,3730,3684,3413,3849,2924,2895
,4593,5026,5792,5238,4917,4822,5057,4968,6425,64
22,6670,
6321,5452,5699,4588,4727,6437,6532,6235,6728,566
0,5509,5293,5241,1907,1786,1527,1949,3040,2495,3
292,338
6,4825,4796,4539,4837,5673,5319,5904,5299,7233,7
188,6913,6342,6316,6264,6345,6480,5348,5458,4941
,5016,54
32,5824,4478,4918,2781,2875,3496,3467,2982,2930,
3745,3655,1902,1759,2017,1909,2985,3011,3427,335
9,3255,3
306,3197,3629,2795,2553,2903,2972,5510,5294,4947
,4826,6206,6426,7424,7202,5674,5701,5513,5403,45
94,4976,
5242,5568,6287,6247,6322,6438,4838,4541,4567,473
1,1963,2018,2004,1950,3732,3688,3414,3388,3313,3
850,278
2,2877,3635,3417,3524,3469,3013,2986,3475,3279,1
788,1965,1991,1910,5028,4783,5473,5681,4999,4921
,5323,51
83,6237,6788,6346,6736,6467,6536,7192,7204,3746,
3630,3857,3504,2932,2554,3429,3259,5460,5514,459
6,4942,6
441,6914,6251,6324,4841,4922,5647,5702,5676,5301
,5415,5405,6295,6353,6428,6792,4828,4542,5352,52
44,2797,
2993,3308,3736,3696,3659,3014,2803,2907,2988,385
2,3777,1855,1971,1531,1913,5325,5302,5763,5682,5
058,503
2,4571,4949,4963,4733,5406,5705,5419,5474,5331,5
521,5003,4583,4791,4842,7175,7297,6238,6348,3198
,3314,36
37,3470,2008,1775,1966,2020,3418,3528,2878,2959,
2919,2687,3430,3477,6442,6544,6752,6496,4924,484
9,5305,5
516,3375,3641,3316,3667,2936,2527,3261,3638,3748
,343
3,3778,3661,2994,2798,3287,3858,5464,5706,4950,4
953,
6469,6677,6299,6354,1995,1914,1533,1973,3719,342
0,3491,3478,5765,5713,5655,5360,5326,5215,4600,4
895,353
6,3752,3017,2556,2909,2805,3873,3434,6449,6691,6
444,6253,4351,5060,5447,5684,5920,5522,5476,5427
,7234,76
80,6328,6678,3018,2967,3662,3481,2923,2910,3642,
3860,5005,4815,4573,5011,5421,5537,4734,4844,504
0,4965,5
333,5688,4587,4795,5952,5708,6681,6259,6311,6369
,6470,6450,7179,7208,3669,3644,2806,2996,3291,33
83,3780,
3670,4850,4954,5306,5766,5524,5347,4574,5064,601
6,5714,5538,5422,5769,5891,4479,5006,1997,2024,1
916,197
4,3673,3723,3493,3864,3025,2971,3874,3683,3020,2
809,3674,3482,3303,3760,2925,3000,1887,1783,2032
,1534,69
16,6301,6800,6473,6254,6261,6356,6315,3725,3320,
2543,2751,3441,3262,3436,3726,7236,7298,6920,647
4,6370,6
693,6682,6531,5480,5659,5231,5451,4911,5072,4966
,5013,2983,3026,3731,3407,3552,3387,3293,3442,64
52,6360,
7187,7181,6560,6415,6423,6302,4823,4589,5334,542
9,4969,4797,5308,5569,3685,3494,3497,3523,3686,3
615,330
7,3484,5337,5528,5027,4852,5729,5716,5671,5770,7
216,7182,6481,6694,4956,4595,5349,5279,6816,6262
,6476,67
23,5540,5430,5661,5893,2003,1977,1019,1021,2931,
2810,3415,3444,2551,2973,3847,3389,3294,3498,292
6,2783,6

684,6533,6317,6265,4827,4919,5018,4970,3525,3309
,3041,2933,3631,3905,3876,3784,5730,5777,5014,45
98,5453,
5239,5720,5459,6697,6343,6928,6323,5029,4839,533
8,5488,2987,3042,3906,3733,1787,1998,1978,1903,6
372,648
2,6456,6848,4856,4977,5772,5350,3880,3851,3689,3
676,2005,2006,1951,2019,7240,7425,6534,6318,5511
,5433,55
70,5662,5454,5353,4590,4798,6698,6725,7189,7300,
5675,5894,5017,4597,6537,6427,6266,6592,5295,524
3,5778,5
732,5461,5897,4972,4943,3505,3792,3888,3908,3028
,2974,2812,2989,6497,6705,7203,7426,6347,6207,64
84,6538,
3419,3969,3315,3734,1789,1980,1911,2009,5088,454
3,5340,5434,4829,4923,5544,5515,5030,4978,5793,5
703,503
3,5059,5475,5407,6671,6726,6700,6325,5303,5354,5
245,5677,3526,3390,3015,2934,3747,3690,2879,2995
,3970,38
53,3448,3500,3737,3808,2555,2937,4843,4601,4951,
5020,5780,5736,5462,5436,2021,2010,1967,1915,363
9,3912,3
697,3310,6439,6429,6376,6268,5361,5898,4830,4925
,3032,2799,3431,3529,2990,3044,3471,3859,6349,63
26,6787,
6706,5683,5465,5572,5517,3663,3750,3506,3749,202
2,1790,1535,2012,6430,6729,7194,7681,6443,6498,7
248,720
5,5061,5034,5523,5327,5794,5678,5905,5552,4980,4
602,5477,5307,6355,6545,6329,6540,3421,3317,3530
,3738,36
92,3435,3019,2938,3199,3263,3854,3479,3508,3698,
2557,2997,7193,7190,6488,6730,6789,6737,6679,638
4,4845,5
041,5356,5784,5744,5707,5062,4851,6350,6239,6471
,6708,6944,6546,7304,7428,3021,3048,3643,3537,37
53,3318,
3779,3422,4955,5036,5900,5825,5246,5362,5685,551
8,5466,5576,4926,5007,4967,4735,5478,5525,2940,2
998,367
1,3740,3862,3532,3321,3754,5423,5689,5364,5715,6
500,6451,6445,6561,7432,7206,6357,6712,4984,4575
,5309,56
86,6976,6732,6330,6790,5796,5481,5826,5709,2025,
1975,1022,1023,2911,2807,3056,2558,5042,4846,533
5,5906,5
767,5468,5539,5526,3645,3483,3875,3861,3781,3437
,3512,3700,6548,6371,7040,6738,5584,5800,5065,46
04,6562,
6446,7682,7264,6793,6915,6504,6683,3761,3446,349
5,3538,3027,3001,3865,3322,3443,3553,3646,3485,2
026,191
7,1999,1918,4957,4853,5921,5482,5066,5015,5710,5
529,7235,7209,7312,7196,6255,6475,6358,6453,4971
,4958,56
90,5908,6332,6593,6361,6552,5717,5692,4854,5044,
6753,6740,6695,6794,2811,3022,3675,3438,3540,372
7,3002,2
927,3972,3877,3029,3030,3687,3756,3782,3501,5339
,5431,5828,5718,5721,5771,5541,5912,7237,7210,63
73,6303,
5073,5019,5922,5731,5068,4857,5722,5530,6564,645
4,7684,7217,3866,3324,2975,3043,3445,3677,3920,3
762,668
5,6917,7242,7440,6754,6801,6477,6263,6744,6483,6
362,6512,5351,5808,4973,5048,6796,6374,6535,6457
,5773,53
68,4591,4799,2033,1979,2028,2034,3785,3704,3554,
3878,5489,5310,5484,5774,5031,5074,5779,5455,560
0,5435,5
341,5490,5733,5542,5545,5571,6594,6686,7328,7688
,6478,6377,6699,6918,6319,6267,6802,6756,7456,76
96,6485,
6921,3499,3976,3486,3295,3735,3764,3907,3691,354
4,3527,3868,3881,2813,3004,3786,3793,5734,5663,5
355,553
2,6364,6458,7360,7712,3909,3788,3936,3882,2935,3
033,3678,3984,4979,4858,5463,5492,6568,6539,6817
,6727,37
94,3768,3449,3507,3045,3034,3889,3391,4599,5021,
5895,5437,5342,5546,4974,4831,7238,7212,6499,643
1,5573,5
357,5089,4981,1981,2007,1982,2011,3693,3884,3556
,3502,6327,6378,7299,7249,5679,5953,5924,5832,62
69,6701,
6804,6760,5035,5090,5954,5781,7218,7241,7183,748
8,5928,5899,5737,5724,6486,6460,6385,6922,6707,6
489,659
6,6541,3910,3739,2991,2939,3560,3311,3450,3531,5
553,5840,5936,5956,5076,5022,4860,5037,3694,3699
,3509,34
52,3890,3533,3046,2814,5467,6017,5363,5782,7301,
7220,7191,7302,6547,6351,6818,6702,6929,6576,650
1,6331,3
568,3741,2559,3036,3751,3796,3913,3701,6380,6808
,6768,6731,5574,5438,5063,4982,3423,3539,3510,38
09,2036,
2023,2040,1791,7552,7244,6924,6849,5795,5738,492
7,5043,6018,5901,5496,5548,6270,6386,6709,6542,3
323,353
4,3514,3513,3049,2999,3541,3319,5785,5856,4603,4
985,5687,5960,5745,5358,5080,4847,5479,5577,5038
,5092,55
19,5907,7305,7250,6490,6600,6502,6549,7224,7195,
5711,5798,5554,5797,7265,7207,6447,6713,6388,673
9,6333,6
710,5469,5365,5578,5786,5740,5483,5067,4986,6820
,6505,6850,6733,5247,5311,5902,5527,6359,6930,67
91,6492,
3755,3914,3810,3971,3742,3855,3921,3892,6563,655
0,6608,6824,6945,6506,7427,7252,3800,4000,3863,3
439,305
0,2941,3973,3702,6734,6553,7306,7313,7429,7197,6
714,6932,5556,5746,4605,5045,5069,5096,5691,5585,3757,3916,3705,3783,2013,2027,2014,2029,5801,5366,5827,5470,4988,5046,5719,5788,3325,3763,3023,2942,3896,3974,3758,3812,5910,5580,5369,5802,6741,6716,6363,6455,7211,7266,7683,7256,6852,6742,6745,6795,3922,3447,3516,3542,3555,3487,3557,3977,4959,4855,5104,4606,6565,6936,6946,6755,5693,5531,5923,5909,5829,5485,5560,5748,7308,7198,6746,6554,5809,5494,5543,5586,7314,7239,6375,6832,6797,6392,6513,6334,5075,5049,5913,5370,5491,5601,5694,5533,3057,3003,3867,3545,3706,3816,3924,4032,3937,3765,3869,3978,3787,3879,3052,3058,6508,6798,6803,6479,7430,7433,6624,6459,6365,6514,7329,7744,4859,5070,5723,5486,7213,7268,6757,6566,5588,5775,5050,4975,1983,2035,2037,1919,3546,3708,3005,3031,6569,6595,7808,7219,6020,5925,5077,5078,3766,3326,3789,3647,3985,3870,3006,3035,6758,6687,6379,6556,6487,6516,7316,7214,5735,5804,5830,5549,6919,6461,6366,6570,5914,5372,5023,5091,5493,5725,5968,5810,3883,3451,3769,3503,3679,3561,3938,3795,5833,5752,5602,5926,7243,7434,6597,6381,5547,6024,5534,5343,6703,6977,6948,6856,3060,3047,3558,3980,3790,3885,3548,3928,7441,7685,7272,7330,5783,5812,5955,5739,3911,3797,3064,2815,3770,3986,3824,3940,5592,5575,5916,5929,6978,6805,6952,6923,7221,7361,6761,6748,7320,7245,6577,6864,4861,5052,5834,5841,6960,6980,6491,7041,7332,7936,7436,7442,6387,6806,6598,6462,5957,5836,5984,5930,4983,5081,5726,6032,5842,5816,5497,5555,6819,6762,7686,7222,3891,3886,3511,4001,3562,3695,3743,3811,7042,6925,6520,6572,7251,7225,6809,6880,5093,5082,5937,5439,5741,5932,5604,5550,5958,5787,5039,4987,6711,6984,6769,6382,3988,3535,3915,3453,3037,3051,3569,4002,3893,3798,4033,3944,3564,3703,3801,3772,7689,7280,7303,7246,5608,5359,5498,5579,6503,6601,7457,7362,6543,6931,6735,6822,7253,7444,6578,6821,5742,5747,5557,5500,3515,3813,3038,3053,3917,3992,3454,3894,5938,5581,5094,4862,6493,6389,6602,6810,6764,6507,6271,6335,6926,6551,7690,7226,5616,5789,4607,5084,5799,5844,5961,5749,3923,3802,3570,3952,3814,3517,3543,3707,3007,3059,4004,3759,3975,3897,3572,3918,7336,7307,6580,6770,5471,5587,5558,5857,5371,5582,5562,5561,6715,6609,7267,7254,5097,5047,5589,5367,6825,6390,6851,6494,5803,5962,5858,6019,7228,7448,6743,6812,6934,6604,7257,7458,5790,5903,5969,5940,6393,6826,6717,6555,6947,6933,6853,6509,3817,3898,3804,3518,4034,4008,3547,3925,7697,7692,7364,7309,5848,6048,5911,5487,6584,6772,6833,6518,6567,6610,6937,6394,5098,4989,6021,5750,5805,5964,5753,5831,3939,3709,3979,3559,3061,2943,3767,3818,5373,5811,5071,4990,7269,7315,7344,7310,5944,6022,5806,5860,7698,7489,7199,7368,3900,3825,3926,3929,3576,3871,3327,4036,6515,6625,6718,6557,5970,5495,5564,5590,3981,3791,3549,3987,3710,3820,3054,3062,7258,7713,7460,7490,6747,6510,6612,6799,5603,5535,5605,6025,7044,6949,6759,6828,7700,7431,6854,6573,7317,7270,6938,6396,4016,3941,3563,3771,2030,2038,2041,2042,5105,5051,5915,5593,5754,5864,5972,6080,7273,7472,6517,6749,5985,5813,5917,6026,6992,6834,6857,6776,7464,7331,6626,6950,5835,5927,5100,5106,7260,7215,6571,7048,5594,5756,5053,5079,7435,7553,6558,6367,6807,6836,7714,7492,6979,6763,7376,7554,6616,6599,6940,6953,5814,5374,5837,5695,7318,7321,7333,7274,6033,5918,5054,5083,6858,6865,6981,6860,7008,6954,6750,7056,7223,7496,6866,6840,5931,5499,5817,5551,3826,3930,3550,4040,3455,3982,3887,4048,5727,5609,5986,5843,6521,6579,6961,6463,5108,5095,5606,6028,7704,7745,6765,6956,5838,5933,5596,5976,7716,7281,6628,6574,3942,3989,3065,3066,3799,3565,3945,3773,5959,5845,5112,4863,7322,7247,7437,7276,6982,6811,6632,6383,6522,6603,7746,7392,5818,6034,5872,5988,5939,5934,5559,6049,4003,3828,3932,3571,3803,3895,3994,3946,7334,7687,7720,7363,6766,6771,6581,6524,7438,7809,7691,7443,5610,5743,5791,5859,6962,6605,6640,6813,6823,6868,6985,6773,6036,5583,5963,5501,6495,6611,7748,7459,3990,3574,4005,3815,3039,3068,3832,3953,7227,7337,6582,6881,7728,7282,6395,6606,5085,5099,5617,6050,6586,6585,6613,6391,5941,5846,6081,5992,7445,7324,6827,6986,7255,7365,7284,7338,5612,5751,5849,5820,5563,5861,5086,5101,6882,7043,6814,6927,3566,3774,3993,3573,3948,3919,4064,3519,7229,7699,7693,7810,6993,6964,7449,744

6,3805,3899,4006,3954,4009,4035,3819,3577,6872,7
072,769
4,7345,5965,6040,5502,5942,5971,5850,5618,6000,6
935,6511,7045,6774,7461,7556,6829,6988,6777,6855
,7259,77
52,5862,5565,5591,5755,7937,7366,7340,7288,7369,
7504,6397,6835,7230,7450,6968,7046,5055,5107,605
2,5807,6
830,6884,6994,6519,3927,3996,3806,3901,4037,4010
,3956,3578,6588,6614,6627,6559,7311,7271,7346,74
62,7261,
7812,7370,7760,6023,5945,5620,5966,5865,5946,585
2,5566,6629,7049,7491,7560,6082,6056,5595,5973,6
939,661
7,7465,7938,5987,5757,6027,5607,6778,6888,6996,7
104,7275,7348,7009,6837,5109,4991,5815,5866,7319
,7377,69
41,7050,7452,7816,6859,6951,3821,4017,4038,3827,
3931,4012,3902,3983,7262,7372,6618,6780,7466,756
8,7776,7
520,5948,5873,5974,5977,6838,6398,6861,6719,5624
,5919,5375,6084,7057,6942,7493,7701,7323,7378,74
73,7715,
6029,5839,5597,6035,3943,3711,3960,3551,4018,382
2,4041,3580,7468,7277,6955,6523,5758,5868,5102,5
110,735
2,7702,6841,6575,6751,6633,7705,7283,6064,5989,5
611,5819,7010,6867,6630,7052,6862,6957,6620,7000
,7335,73
93,7494,7474,6983,6869,7940,7325,7824,7497,6842,
7058,6896,7012,7278,7285,6963,6958,7380,7339,393
3,3829,4
042,3991,2015,2044,2031,2039,5874,5978,5598,6088
,7944,7498,7394,7717,5503,6030,5935,6096,7706,75
55,7476,
7384,6583,7073,6634,6767,5990,6037,5113,5114,681
5,6883,7060,6607,5847,5613,5993,5821,6987,6525,7
584,743
9,7447,7326,7505,7718,6051,5876,5980,5619,6641,7
074,7840,7286,3947,3934,3830,4020,4049,3995,4044
,3833,69
65,6870,7105,7016,7500,7747,6636,6775,3949,4024,
3567,3775,4007,4050,3055,3063,7708,7557,7341,728
9,6873,6
844,6587,6885,5851,5943,6042,5994,6038,5622,6053
,5863,7721,7367,7952,7347,7396,7506,6989,7064,39
55,3834,
3575,3997,3950,3807,4065,3957,7480,7872,6526,696
6,5087,5116,5880,6001,7558,7342,6995,6874,5614,5
822,604
1,5621,7722,7749,7561,7451,6642,7024,7290,7616,6
886,6589,6615,6779,5996,5967,6112,5567,4011,4066
,4052,39
98,3836,4013,4039,3958,7076,6831,7521,7729,7047,
6969,7371,7231,5853,5947,6054,6002,7508,7562,664
4,6990,6
057,6083,5867,5625,6889,6970,7695,7750,7724,7349
,7463,7453,6876,6590,7400,7292,3903,4019,3579,39
61,4056,
3823,4014,4068,7373,7350,7811,7730,7106,7080,661
9,6997,7011,6781,7454,7753,5975,6044,5854,5949,7
467,752
2,7379,7569,7051,6631,6839,6890,6972,6897,7353,7
564,6085,6058,6004,5626,5869,6065,6086,5875,7512
,7754,69
98,7001,7813,7761,7703,7408,7374,7263,6648,6943,
5979,6060,5950,6031,6399,7108,7495,7732,7968,757
0,7524,7
475,7053,6863,6621,7059,4043,3962,3581,4021,2043
,2045,2046,2047,5991,5759,6008,5599,6066,5870,60
89,5628,
7469,7585,6782,6892,7088,7013,7381,7736,6635,684
3,8000,7756,6898,7002,7354,7814,7572,7395,6622,7
112,806
4,7762,7586,7470,5981,5877,6090,6039,7817,7939,6
527,7054,7528,7707,7279,7499,6959,7120,7014,7061
,4045,40
72,3964,4022,3935,3831,4080,3582,5995,5982,5878,
6068,6871,6637,7382,7477,7017,6845,7356,7617,609
7,6043,6
092,5881,7385,7576,7075,6900,5997,6072,5615,5823
,7777,7764,7719,7818,7004,6643,7397,7327,7588,74
78,7709,
7941,6055,6098,5103,5111,6875,6967,7066,7018,777
8,7825,7062,6646,4051,4025,3067,3069,3835,4046,4
026,395
1,7501,7287,7768,7507,7077,6887,7386,7536,6904,7
025,7820,7398,7559,7481,7618,7710,7502,7401,6638
,6846,77
23,7942,7065,6645,7343,7291,7826,7780,7509,7945,
7020,6991,6003,5882,5623,6045,7136,6591,7388,748
2,6877,6
971,7592,7563,7078,7026,7841,7751,5998,5855,6113
,6005,7081,7107,7523,7455,7351,7402,7293,7725,68
91,6649,
6999,7068,6059,6114,6100,6046,7828,7784,7510,748
4,4053,4054,3999,4067,3837,4028,3959,4057,7409,7
946,687
8,6973,7731,7513,7620,7565,7109,7082,7571,7375,5
884,6061,6087,6006,7842,7726,7953,7600,7028,6650
,7525,73
55,6893,7089,7404,7832,7792,7755,7110,6899,7003,
7084,7948,7873,5951,6067,5627,6009,7294,7410,773
3,7566,6
104,5871,6062,6116,7514,7624,6974,7055,7015,6783
,7526,7573,7471,7737,7412,7763,7032,6623,7357,77
34,4069,
4058,4015,3963,4070,3838,3583,4060,7844,7529,787
4,7757,7090,6894,7383,7954,6091,6010,5629,6069,7
815,751
6,7587,7574,7632,7848,7113,6652,7005,6901,7969,7
530,7114,7063,7758,7577,7019,7006,7738,7956,7765
,7740,69
02,7092,7387,7479,7876,7766,6093,6120,6012,6070,
7769,7819,7589,7960,7121,7067,7970,7779,7116,690
5,7770,7

578,4073,4023,3070,3071,4074,3965,4047,3966,7399,7856,7021,7096,5983,5879,6128,5630,7821,7416,6639,6847,7537,7358,7532,7822,7079,7122,7827,7503,7648,7483,7389,7538,7781,7590,7593,7619,7782,7711,7403,7580,6099,6073,5115,5117,7027,6906,7511,7540,6647,7069,7943,7485,7390,7594,7022,6879,7621,7405,7137,7029,7727,8001,7972,7880,7083,7138,8002,7829,5883,6094,6074,5999,4081,4027,4076,4082,4029,4055,4030,4059,7976,7947,7785,7772,6101,6102,6047,6115,7601,7888,7984,8004,7124,7070,6908,7085,7515,8065,7411,7830,5885,6076,6007,6105,7622,7486,7111,7030,7843,7786,6975,7091,8066,7949,7544,7596,7833,7904,6651,7033,6117,6106,6063,6011,7735,8008,7793,7406,7128,6895,7527,7625,7086,7140,7567,7955,7759,7846,7602,7845,6118,5886,5631,6108,7517,7413,7626,7834,7788,7531,7115,7034,7295,7359,7950,7575,7604,7794,6653,7093,7117,7144,7739,7633,7849,7414,7875,7518,7036,7094,7767,7836,7958,7628,7417,7850,6121,6071,5118,5119,7007,6903,7152,6654,7741,7579,7971,7957,7877,7533,7608,7796,7857,7542,7591,7634,7123,7097,7961,7418,7539,7649,7742,7581,6122,6013,6095,6014,6907,7118,7771,7534,7636,7823,7098,7023,8068,7973,7125,7126,7783,7852,7878,7597,7962,7420,7071,7139,7541,7773,8016,7858,6129,6075,6124,6130,7881,7800,7650,7974,7595,8072,7582,7391,7831,7860,8003,7787,7640,7623,7964,7977,6909,7100,7882,7889,8005,7884,8032,7978,7031,7129,7774,8080,7890,7864,7545,7603,7141,7130,7985,7487,6077,6103,6078,6107,7789,7980,7652,7598,8006,7835,7087,7035,7656,7407,7546,7627,7790,7795,7605,7548,7986,7629,7142,6910,7664,7837,6655,7132,7847,7892,8009,7797,7519,7635,7606,7905,6132,6119,6136,5887,7419,7630,7610,7609,7145,7095,7637,7415,4084,4071,4088,3839,4061,4075,4062,4077,7851,8010,7906,8067,7838,7951,8017,7988,7896,8096,7959,7535,7146,7037,8069,7798,7853,8012,7801,7879,6109,6123,6110,6125,7421,7859,7119,7038,7992,8070,7854,7908,8018,7543,7612,7638,7651,7583,7653,8073,7153,7099,7963,7641,7802,7912,8020,8128,8033,7861,7965,8074,7883,7975,7148,7154,6079,6131,6133,6015,7642,7804,7101,7127,7862,7422,7885,7743,8081,7966,7102,7131,7979,7547,7865,7599,7775,7657,8034,7891,7156,7143,7654,8076,7886,7981,7644,8024,8007,7893,7160,6911,7866,8082,7920,8036,7987,7982,7607,8097,7658,7791,7839,7907,8084,7631,8011,7549,7133,7147,7665,8098,7989,7894,8129,8040,7660,7799,7897,7868,7611,7909,7134,7149,8013,8088,7550,7990,8019,7898,7666,8048,7910,7613,7639,7803,7103,7155,8100,7855,8071,7993,7668,8014,7913,7994,7900,7614,8130,8104,7643,8021,4031,4083,4085,3967,4078,4086,4089,4090,8035,7805,8075,7655,7157,7039,7863,7914,7996,7921,8022,8025,7672,7967,7423,8132,8077,7887,7645,8083,7806,7916,7150,7158,8112,8037,7659,7867,6126,6134,6137,6138,7922,8026,7646,8136,7551,8078,7983,8144,8038,8085,7161,7162,7895,7661,8041,7869,8099,7924,8028,7667,7899,7991,8090,8042,8086,7670,8101,7911,7135,7164,7928,8049,7662,7870,8089,7669,8044,8015,8160,7615,7901,7995,8102,8050,8105,8131,7915,7673,8023,8092,7902,7997,8133,8106,8052,7674,4063,4092,4079,4087,4091,4093,4094,4095,7917,8113,8134,7923,8027,8108,7998,8079,8039,7807,8056,7647,8114,7918,8137,7676,8029,7925,8138,8087,6111,6140,6127,6135,8043,8030,7926,8116,8145,8091,8140,7929,8045,8120,7663,7871,8103,8146,7151,7159,8051,7930,7671,8093,8046,7903,8161,8053,8107,8162,8148,8094,7932,8109,8135,8054,7999,8115,7675,8057,8152,7919,8110,8164,8139,8058,7677,8117,6139,6141,6142,6143,8141,8168,8060,8118,8031,7927,8176,7678,8147,8121,7163,7165,7931,8142,8122,8047,8149,8150,8095,8163,7933,8124,8055,8153,8165,8154,8111,8059,8166,7934,7679,8156,8169,8119,7166,7167,8170,8061,8143,8062,8177,8123,8172,8178,8125,8151,8126,8155,8180,8167,8184,7935,8157,8171,8158,8173,8127,8179,8181,8063,8174,8182,8185,8186,8159,8188,8175,8183,8187,81 89,8190,8191]

**Sequence group 2: Z2_8192**

[0,1,2,7,3,8,11,24,4,10,13,28,16,33,35,78,5,12,14,32,19,38,47,82,22,46,42,89,57,97,105,174,6,17,21,40,23,45,51,91,29,55,59,100,73,112,117,189,34,61,76,115,81,126,139,206,88,141,151,232,158,242,276,409,9,18,26,54,30,58,72,107,36,77,62,118,85,133,145,213,44,75,87,140,93,148,157,238,103,160,176,266,188,284,302,449,53,90,1
01,156,113,166,183,281,122,184,205,294,217,319,34
0,488,143,211,235,325,240,341,365,531,273,371,402,
553,419,
580,632,874,15,25,31,74,39,80,83,144,48,86,94,155,
104, 165, 171,280,56,95, 106,
167,116,182,202,296,132,203,212,
314,237,333,359,515,66,110,123,187,134,204,220,32
6,154,233,241,343,272,370,383,552,170,255,282,375,
295,415,
421,576,322,438,470,619,504,654,727,875,70,127,14
7,223,164,239,271,373,175,274,286,408,303,420,448,
613,200,
297,315,436,342,466,490,668,353,506,534,698,560,7
36,774,1027,219,327,348,473,376,514,537,722,418,5
49,577,7
62,620,779,847,1107,447,602,633,812,652,869,905,1
175,725,916,947,1170,1003,1250,1349,1692,20,37,41
,92,49,9
6,108,181,50,109,119,190,136,216,224,357,63,120,13
7,227,149,236,253,358,159,252,277,401,298,417,424,
575,68,
146,161,229,178,264,283,416,186,292,308,432,318,4
58,477,650,185,316,329,457,352,491,517,699,378,53
9,561,73
5,601,773,815,1075,79,173,179,288,195,312,328,450,
207,335,347,489,366,530,548,731,275,362,377,533,4
10,558,6
00,768,442,605,638,806,671,868,907,1160,311,404,4
33,574,456,618,640,856,482,665,681,873,728,923,97
3,1217,5
35,726,737,964,769,1010,935,1259,834,1072,1112,13
71,1139,1473,1534,1766,84,191,201,351,265,369,382
,538,28
9,400,411,569,439,607,635,860,309,437,453,612,472,
641,677,881,507,685,719,919,763,967,1026,1263,356
,459,47
6,676,516,712,743,944,568,748,775,1022,835,987,10
95,1375,617,802,866,1073,886,1138,1166,1452,932,1
173,117
2,1514,1260,1573,1621,1937,403,505,544,749,606,77
8,814,1049,639,857,870,1113,913,1145,1171,1463,67
8,901,9
45,1161,974,1174,1261,1574,1048,1289,1342,1630,1
390,1706,1742,2125,734,965,1018,1262,1094,1280,1
382,1649,
1106,1377,1454,1716,1502,1801,1898,2270,1146,148
8,1556,1829,1602,1907,1867,2344,1686,1969,2033,2
474,215
1,2586,2643,2994,27,43,52,102,60,121,138,221,67,14
2,150,226,163,244,254,412,69,162,172,243,180,313,3
23,446,
208,324,350,483,368,524,545,761,71,177,194,317,21
0,349,363,510,222,372,388,550,414,581,615,784,234,
405,423,
604,451,634,655,844,467,651,690,900,697,918,966,
1351,
111,209,218,367,228,389,413,571,267,425,443,623,4
69,6
67,684,862,287,445,475,653,509,696,709,910,532,71
0,718,972,799,1011,1062,1376,310,508,528,715,555,
742,760,
982,583,798,817,1041,872,1090,1136,1455,622,846,8
87,1137,933,1151,1219,1503,1015,1240,1300,1575,1
343,163
3,1710,2093,114,225,245,422,285,444,471,670,299,4
80,511,711,536,724,729,975,334,529,554,730,582,79
3,813,10
28,621,842,871,1105,911,1147,1198,1460,364,570,61
4,816,664,867,863,1148,679,904,917,1178,983,1238,
1256,15
77,723,934,1013,1251,1029,1315,1348,1650,1071,13
74,1418,1717,1513,1805,1899,2271,379,631,666,906,
708,922,
986,1241,787,1014,1056,1338,1059,1350,1388,1705,
803,1057,1070,1381,1149,1405,1493,1800,1212,1512
,1539,18
60,1620,1940,1990,2351,843,1167,1196,1461,1257,1
515,1572,1877,1301,1608,1651,1968,1711,2064,2137
,2489,14
24,1661,1736,2071,1819,2169,2202,2641,1884,2241,
2321,2724,2414,2856,2971,3371,135,270,293,481,33
2,525,55
1,772,346,559,603,795,630,833,880,1199,374,616,66
9,861,691,921,912,1216,713,946,1002,1288,1050,131
8,1357,1
687,452,680,714,920,786,981,1019,1339,794,1051,10
61,1370,1091,1389,1429,1788,804,1074,1144,1428,1
205,149
2,1535,1861,1254,1581,1609,1941,1660,1991,2090,2
462,468,785,792,1040,805,1058,1104,1404,845,1150,
1179,14
72,1239,1530,1603,1927,1012,1204,1258,1538,1302,
1631,1674,1970,1391,1675,1737,2080,1828,2168,218
5,2640,1
060,1314,1380,1632,1425,1713,1790,2092,1495,1804
,1863,2184,1926,2262,2350,2735,1557,1885,1945,23
20,2032,
2359,2455,2876,2124,2475,2547,2923,2604,3113,313
9,3717,474,807,832,1197,980,1218,1255,1580,1023,1
281,131
9,1648,1383,1704,1767,2091,1063,1356,1419,1707,1
462,1791,1866,2173,1531,1906,1862,2237,1971,2345
,2413,27
78,1213,1453,1489,1818,1576,1876,1944,2276,1629,
1948,2017,2388,2081,2415,2492,2922,1712,2065,213
6,2463,2
203,2587,2605,3017,2263,2689,2734,3209,2857,3258
,3302,3616,1303,1494,1628,1949,1693,2016,2070,24
54,1743,
2150,2172,2546,2240,2588,2725,3138,1789,2236,227
7,2688,2412,2742,2743,3259,2488,2877,2897,3303,2
995,347
2,3538,4076,1936,2358,2389,2779,2493,2896,2970,3
353,2589,3016,3112,3473,3242,3539,3822,4502,2642
,3208,32 43,3617,3352,3716,3823,4503,3370,3934,3935,5042,4077,5043,5378,5379,64,65,98,153,99,168,193,300,124,192,215,330,246,355,361,590,125,214,230,354,269,390,441,610,290,440,426,643,487,689,717,962,152,247,279,406,291,435,465,649,331,485,513,700,573,740,771,1021,360,519,588,751,609,796,819,1068,642,841,883,1164,908,1200,1252,1583,169,268,320,484,344,512,572,721,380,589,526,776,629,801,855,1101,434,579,637,840,683,864,903,1180,703,914,968,1242,1020,1276,1340,1685,479,648,701,902,741,948,1001,1273,790,1008,1055,1312,1103,1369,1426,1786,853,1093,1169,1379,1182,1427,1491,1869,1247,1511,1558,1921,1623,1966,2084,2552,231,301,345,578,391,608,611,854,454,636,686,885,716,931,951,1272,486,687,720,949,770,1000,1052,1316,800,1053,1100,1364,1177,1407,1477,1831,546,738,791,1017,808,1054,1116,1392,884,1165,1183,1431,1246,1510,1537,1920,950,1215,1274,1519,1313,1613,1625,1964,1372,1662,1738,2035,1806,2126,2273,2553,562,797,859,1119,930,1181,1245,1517,963,1248,1278,1582,1341,1624,1684,2019,1042,1317,1365,1638,1430,1714,1802,2138,1451,1816,1878,2208,1938,2282,2348,2795,1115,1393,1442,1741,1528,1830,1887,2260,1622,1897,1965,2306,2066,2357,2479,2933,1683,1988,2085,2426,2114,2533,2601,3019,2269,2610,2691,3008,2777,3136,3285,3762,278,381,407,682,455,688,732,985,464,733,777,1024,810,1102,1140,1475,527,788,811,1143,865,1176,1207,1476,909,1206,1253,1555,1336,1615,1634,1951,556,858,915,1163,970,1236,1275,1614,1016,1290,1344,1636,1368,1708,1763,2112,1009,1366,1395,1699,1450,1803,1845,2209,1532,1893,1939,2281,1975,2347,2453,2899,591,961,971,1282,1031,1358,1394,1694,1069,1417,1441,1787,1500,1868,1896,2279,1249,1478,1529,1871,1600,1924,1974,2322,1672,1997,2088,2424,2141,2532,2603,3004,1347,1578,1637,1950,1698,2034,2094,2490,1784,2133,2171,2545,2274,2653,2727,3071,1879,2272,2283,2692,2323,2780,2669,3157,2466,2882,2934,3325,2959,3459,3558,3920,628,1025,1043,1449,1237,1509,1536,1892,1283,1554,1601,1943,1663,1999,2087,2494,1345,1639,1697,2018,1740,2095,2143,2555,1817,2175,2243,2649,2307,2695,2794,3177,1474,1709,1762,2142,1844,2214,2285,2670,1942,2286,2349,2792,2467,2763,2903,3327,2023,2408,2522,2883,2584,2958,3006,3398,2654,3011,3010,3536,3158,3593,3667,4119,1559,1807,1894,2287,1998,2356,2452,2833,2089,2491,2534,2935,2609,2969,3009,3457,2148,2591,2671,3005,2732,3018,3159,3594,2832,3211,3256,3674,3362,3806,3906,4323,2280,2693,2786,3176,2902,3178,3354,3699,2932,3345,3420,3834,3516,3949,4092,4462,2992,3474,3562,3979,3646,4095,4029,4594,3760,4139,4263,4758,4327,4834,4951,5254,321,427,478,702,518,789,818,1117,547,852,882,1142,929,1202,1214,1610,557,928,960,1201,984,1359,1373,1682,1088,1378,1448,1785,1508,1846,1895,2305,563,969,1030,1367,1092,1443,1479,1822,1118,1516,1552,1904,1612,1967,2021,2364,1168,1579,1627,1996,1695,2086,2127,2476,1715,2113,2186,2590,2201,2648,2694,3287,739,1089,1114,1501,1162,1553,1611,1947,1243,1635,1673,2069,1719,2135,2174,2520,1279,1681,1761,2115,1821,2200,2211,2606,1870,2212,2242,2726,2399,2781,2878,3344,1346,1820,1864,2239,1923,2284,2304,2760,1973,2398,2461,2823,2544,2900,2956,3421,2068,2478,2585,2957,2655,2999,3115,3517,2785,3118,3212,3595,3257,3697,3820,4321,750,1141,1203,1626,1277,1680,1739,2140,1337,1764,1823,2213,1886,2268,2275,2733,1416,1865,1922,2278,1972,2391,2427,2820,2067,2472,2535,2921,2607,2993,3052,3422,1490,1946,2020,2460,2132,2523,2521,2996,2149,2600,2611,3040,2761,3116,3146,3619,2261,2668,2783,3137,2821,3221,3284,3718,2881,3326,3392,3835,3519,3951,4093,4463,1533,2083,2134,2602,2210,2652,2762,3119,2367,2784,2858,3240,2873,3286,3360,3805,2409,2859,2880,3347,2997,3369,3505,3948,3068,3518,3561,4024,3666,4128,4198,4633,2473,3007,3042,3423,3147,3537,3592,4031,3213,3664,3719,4138,3821,4264,4325,4789,3394,3753,3904,4267,3977,4385,4426,4949,4078,4447,4593,5092,4692,5164,5253,5743,809,1244,1291,1765,1406,1847,1905,2346,1440,1925,1989,2397,2082,2465,2554,3053,1518,2022,2139,2495,2187,2651,2608,3070,2215,2690,2776,3210,2834,3222,3301,3761,1696,2170,2238,2650,2366,2741,2787,3241,2396,2835,2875,3324,2901,3361,3397,3922,2410,2898,2968,3396,3055,3504,3559,4025,3144,3645,3665,4129,3752,4199,4282,4756,1718,23
65,2390,2822,2411,2872,2920,3368,2477,2998,3041,
3458,3117,3556,3647,4117,2782,3054,3156,3560,321
4,3675,3
754,4196,3363,3755,3905,4280,3978,4384,4425,4948
,2874,3220,3346,3696,3395,3833,3932,4320,3507,39
50,4027,
4424,4116,4460,4632,5095,3563,4079,4131,4592,426
2,4635,4695,5166,4322,4759,4833,5219,4930,5429,5
431,599
5,1760,2425,2464,3043,2740,3114,3145,3644,2793,3
179,3223,3698,3355,3804,3921,4283,2879,3300,3393
,3807,34
56,3933,4028,4387,3557,4094,4026,4445,4197,4595,
4675,5110,3069,3399,3475,3976,3618,4030,4130,450
0,3673,4
136,4261,4672,4281,4693,4790,5218,3832,4265,4324
,4757,4427,4835,4931,5377,4461,5041,5094,5537,51
65,5640,
5642,5992,3215,3506,3672,4137,3763,4260,4266,469
4,3907,4326,4386,4832,4446,4928,5093,5430,3923,4
444,450
1,5040,4674,5108,5109,5641,4788,5167,5217,5643,5
255,5868,5870,6884,4118,4634,4673,5111,4791,5216
,5252,57
41,4929,5376,5428,5869,5538,5871,6412,6886,4950,
5536,5539,5993,5740,5994,6413,6887,5742,6414,641
5,7140,6
885,7141,7142,7143,128,129,130,199,131,248,251,42
8,196,250,305,460,336,493,495,766,197,304,306,492,
339,522,
567,782,386,566,542,837,645,877,925,1210,198,337,
385,540,387,565,587,839,461,627,647,896,745,940,9
77,1293,
494,673,764,943,781,1006,1067,1326,836,1077,1111,
1444,1134,1482,1540,1933,249,338,430,626,462,646,
744,927,
520,765,674,978,821,1045,1097,1361,564,747,823,10
76,849,1108,1133,1458,899,1152,1220,1506,1292,15
92,1654,
2073,625,838,897,1132,941,1158,1235,1569,990,128
4,1325,1606,1385,1691,1772,2180,1079,1355,1447,1
729,148
0,1773,1841,2255,1525,1859,1910,2297,1987,2384,2
468,2978,307,429,463,746,523,780,783,1096,584,822
,850,113
1,924,1157,1195,1568,644,851,926,1159,976,1234,13
22,1616,1044,1323,1360,1678,1457,1769,1799,2235,
694,938,
991,1287,1046,1324,1396,1730,1130,1445,1481,1775
,1524,1858,1891,2296,1194,1499,1570,1875,1607,19
63,1993,
2360,1702,2038,2130,2447,2188,2530,2687,2979,706
,1007,1099,1399,1156,1459,1523,1873,1211,1526,15
94,1932,
1655,1992,2072,2441,1320,1617,1679,2036,1774,212
2,2182,2556,1793,2190,2258,2614,2308,2720,2766,3
263,138
7,1731,1780,2145,1880,2234,2265,2682,1986,2293,2
361,2754,2448,2791,2927,3387,2047,2402,2469,2868
,2528,29
73,3021,3479,2685,3056,3111,3470,3199,3610,3757,
4284,384,521,541,848,585,876,936,1233,586,937,979
,1294,10
64,1384,1400,1797,675,988,1065,1403,1109,1456,14
97,1798,1135,1496,1541,1909,1618,1985,2008,2355,
704,1098,
1153,1421,1222,1504,1571,1984,1286,1604,1656,201
2,1690,2118,2153,2526,1285,1688,1733,2117,1792,2
183,224
5,2615,1882,2267,2309,2703,2401,2765,2871,3351,7
67,1209,1223,1596,1299,1676,1732,2074,1327,1771,
1779,218
1,1842,2254,2292,2699,1527,1826,1881,2257,1934,2
302,2400,2756,2042,2405,2498,2862,2559,2972,3023
,3460,16
59,1928,2013,2354,2116,2446,2500,2944,2158,2549,
2565,2977,2696,3063,3165,3565,2259,2686,2721,315
2,2757,3
218,3107,3623,2890,3348,3388,3819,3407,3961,4074
,4390,820,1295,1321,1783,1505,1857,1890,2266,159
7,1908,1
935,2325,2039,2407,2471,2948,1657,2037,2077,2440
,2144,2501,2561,2981,2191,2577,2667,3059,2755,31
55,3262,
3627,1796,2119,2152,2560,2244,2644,2731,3108,232
4,2736,2767,3246,2891,3195,3367,3827,2445,2846,2
954,334
9,3002,3406,3466,3928,3104,3477,3476,4022,3624,4
113,4165,4597,1911,2189,2288,2737,2406,2790,2870
,3281,24
99,2945,2974,3389,3049,3433,3471,3947,2562,3013,
3109,3461,3166,3478,3625,4114,3280,3677,3738,419
0,3842,4
294,4362,4813,2702,3153,3230,3626,3366,3668,3838
,4213,3386,3829,3930,4344,3998,4429,4554,4962,34
34,3980,
4100,4485,4134,4559,4511,5048,4278,4645,4717,520
6,4851,5294,5383,5722,431,543,624,898,672,989,106
6,1397,
695,1078,1110,1402,1155,1484,1498,1960,705,1154,
1208,1483,1232,1677,1703,2046,1352,1728,1782,215
9,1856,2
248,2289,2753,707,1221,1298,1689,1354,1781,1827,
2206,1398,1872,1900,2294,1962,2385,2443,2796,144
6,1929,1
995,2404,2075,2470,2531,2924,2123,2527,2582,3012
,2613,3058,3154,3759,939,1353,1386,1843,1420,190
1,1961,2
327,1507,2009,2043,2451,2129,2551,2576,2950,1595
,2045,2147,2529,2205,2612,2621,3046,2256,2622,26
66,3164,
2843,3219,3318,3828,1658,2204,2252,2647,2299,273
0,2752,3182,2387,2842,2885,3277,2976,3358,3404,3
931,245
0,2926,3003,3405,3105,3439,3567,3999,3227,3572,3

700,4115,3739,4193,4338,4797,942,1401,1485,1994,
1593,204
4,2131,2558,1619,2156,2207,2623,2264,2684,2697,3
167,1770,2253,2298,2698,2386,2837,2869,3272,2449
,2894,29
75,3385,3047,3435,3542,3944,1840,2326,2442,2884,
2548,2955,2951,3436,2563,3020,3057,3510,3183,357
0,3620,4
121,2683,3106,3225,3611,3273,3715,3756,4214,3323
,3826,3854,4345,4021,4441,4555,4963,1883,2459,25
50,3022,
2620,3062,3194,3573,2799,3226,3312,3734,3315,375
8,3840,4293,2847,3313,3322,3837,3437,3849,3993,4
428,355
2,4020,4091,4504,4164,4624,4682,5055,2895,3467,3
540,3945,3621,4023,4112,4517,3701,4140,4215,4644
,4339,47
44,4821,5233,3888,4257,4348,4751,4459,4853,4906,
5381,4528,4941,5045,5464,5150,5588,5703,6083,104
7,1522,1
605,2157,1768,2249,2295,2764,1778,2303,2403,2839
,2458,2889,2980,3543,1874,2444,2557,2949,2583,30
61,3048,
3564,2645,3110,3198,3676,3282,3730,3765,4279,207
6,2564,2646,3060,2798,3181,3231,3735,2838,3283,3
317,381
8,3359,3841,3893,4396,2860,3350,3432,3892,3549,3
992,4075,4505,3614,4125,4141,4625,4256,4683,4794
,5198,21
28,2797,2836,3276,2861,3314,3384,3848,2925,3438,
3511,3960,3571,4038,4135,4567,3224,3548,3622,409
0,3702,4
191,4270,4646,3843,4271,4349,4752,4484,4852,4877
,5380,3316,3714,3836,4192,3889,4341,4398,4796,39
95,4440,
4507,4876,4566,4946,5054,5471,4101,4529,4629,504
4,4716,5067,5195,5604,4812,5207,5287,5683,5344,5
845,588
3,6341,2146,2863,2888,3541,3180,3566,3615,4124,3
247,3669,3731,4212,3839,4292,4391,4795,3319,3764
,3855,42
95,3946,4399,4510,4873,4039,4558,4506,4937,4647,
5049,5149,5506,3553,3929,3981,4458,4120,4516,462
8,4984,4
189,4636,4689,5088,4753,5151,5236,5682,4340,4745
,4820,5199,4907,5295,5345,5765,4947,5421,5470,59
53,5589,
5998,6014,6248,3703,3994,4188,4637,4285,4688,475
0,5194,4363,4850,4872,5286,4940,5320,5465,5882,4
397,493
6,4985,5420,5148,5474,5475,5999,5232,5605,5621,6
015,5723,6172,6210,6604,4596,5066,5089,5507,5237
,5620,57
02,6065,5321,5764,5844,6173,5966,6211,6382,6958,
5382,5952,5967,6249,6064,6340,6383,6959,6082,653
0,6531,7
250,6605,7251,7466,7467,692,693,878,1129,879,119
2,1297,1652,1004,1296,1363,1734,1486,1795,1825,2
394,1005,
1362,1422,1794,1521,1902,2041,2430,1598,2040,201
0,2503,2179,2581,2665,3150,1128,1487,1543,1930,1
599,201
5,2121,2525,1735,2177,2233,2616,2353,2728,2759,3
245,1824,2247,2392,2739,2429,2840,2887,3320,2502
,2893,29
83,3464,3044,3544,3612,4127,1193,1520,1700,2176,
1776,2232,2352,2681,1888,2393,2250,2788,2457,284
5,2931,3
373,2014,2363,2497,2892,2567,2952,3015,3512,2619
,3050,3160,3574,3244,3640,3736,4277,2155,2524,26
17,3014,
2729,3140,3197,3629,2818,3216,3299,3712,3375,381
7,3890,4394,2929,3365,3469,3831,3514,3891,3983,4
513,359
9,4019,4102,4561,4167,4642,4784,5288,1423,1653,1
777,2362,1903,2428,2431,2930,2078,2496,2578,3001
,2664,30
67,3143,3628,2178,2579,2680,3141,2758,3196,3296,
3728,2844,3297,3372,3800,3509,3851,3965,4487,229
0,2722,2
819,3229,2864,3298,3400,3844,3000,3465,3515,3895
,3598,4018,4089,4560,3142,3555,3630,4035,3713,41
61,4185,
4640,3824,4258,4350,4719,4442,4814,4965,5289,231
0,2841,2947,3403,3066,3513,3597,4033,3151,3608,3
642,412
6,3737,4184,4276,4691,3278,3729,3801,4210,3894,4
342,4430,4822,3927,4456,4518,4908,4598,4990,5052
,5579,33
91,3845,3910,4361,4036,4486,4531,4944,4166,4553,
4641,5014,4746,5065,5223,5685,4275,4680,4785,516
2,4810,5
281,5325,5767,4961,5350,5423,5760,5505,5880,6009
,6366,1542,1889,1931,2566,2079,2580,2700,3193,21
20,2701,
2789,3260,2866,3374,3416,3963,2251,2816,2867,341
9,2953,3508,3551,3964,3045,3550,3613,4099,3732,4
163,419
4,4639,2300,2946,3051,3463,3162,3568,3631,4162,3
228,3678,3740,4208,3816,4336,4367,4808,3217,3802
,3847,42
91,3926,4431,4497,4909,4072,4533,4599,4989,4679,
5051,5193,5623,2395,3149,3163,3670,3275,3766,384
6,4286,3
321,3853,3909,4395,3996,4512,4552,4987,3609,3966
,4037,4515,4132,4564,4678,5046,4268,4685,4792,51
60,4837,
5280,5327,5736,3743,4122,4209,4638,4290,4718,479
8,5234,4392,4817,4855,5285,4966,5397,5467,5843,4
519,496
4,4991,5424,5047,5508,5417,5905,5202,5618,5686,6
041,5699,6171,6214,6500,2456,3261,3279,3925,3569
,4017,40
88,4532,3671,4098,4133,4627,4259,4687,4787,5238,
3741,4211,4289,4690,4360,4799,4839,5291,4457,487
5,4943,5

393,5015,5427,5578,5909,3962,4337,4366,4838,4496,4934,5009,5418,4626,5010,5053,5576,5203,5479,5647,6043,
4715,5144,5250,5619,5292,5698,5738,6138,5398,5763,5762,6208,5906,6245,6307,6655,4103,4443,4534,5011,468
6,5064,5192,5585,4793,5235,5282,5687,5349,5701,5761,6169,4848,5323,5419,5737,5468,5766,5907,6246,5584,59
55,5996,6310,6070,6378,6498,6827,4988,5425,5542,5908,5646,5910,6066,6339,5684,6045,6140,6410,6180,6533,6
648,6954,5720,6174,6242,6563,6254,6651,6601,6986,6364,6671,6727,7066,6831,7138,7199,7406,1701,2011,2154,
2618,2246,2817,2886,3401,2291,2928,2982,3418,3065,3546,3554,4142,2301,3064,3148,3545,3192,3767,3825,427
4,3356,3830,3924,4393,4016,4498,4535,5013,2311,3161,3274,3803,3364,3911,3967,4482,3402,4032,4096,4556,41
60,4643,4713,5068,3468,4123,4187,4684,4287,4786,4815,5220,4343,4809,4878,5322,4905,5392,5426,6011,2723,3
357,3390,3997,3462,4097,4143,4631,3575,4195,4269,4749,4347,4819,4874,5248,3643,4273,4365,4811,4481,4904,
4911,5346,4514,4932,4942,5466,5107,5509,5606,6044,3742,4480,4508,4939,4563,5008,5012,5476,4677,5106,519
7,5583,5284,5644,5696,6141,4748,5222,5293,5697,5399,5727,5847,6181,5541,5866,5956,6247,5997,6337,6380,68
25,2738,3417,3547,4186,3641,4272,4351,4836,3733,4388,4483,4933,4530,4960,4967,5469,3852,4509,4562,4986,4
676,5091,5163,5580,4747,5204,5283,5681,5347,5721,5828,6142,3982,4630,4712,5196,4816,5251,5249,5724,4849,
5324,5351,5824,5477,5864,5886,6251,4945,5416,5511,5881,5581,5961,6008,6342,5617,6042,6084,6411,6183,653
5,6649,6955,4073,4755,4818,5326,4910,5396,5478,5867,5071,5540,5590,5964,5601,6010,6068,6377,5145,5591,56
16,6047,5725,6081,6177,6532,5840,6182,6241,6564,6306,6664,6722,6989,5205,5739,5826,6143,5887,6209,6244,6
603,5957,6304,6343,6670,6381,6784,6829,7069,6086,6361,6496,6787,6561,6881,6938,7197,6606,6943,6985,7252,
7028,7332,7405,7787,2865,3596,3679,4389,3850,4499,4557,5050,3908,4565,4681,5105,4754,5201,5290,5829,403
4,4714,4823,5239,4879,5395,5348,5842,4935,5422,5504,5954,5586,5962,6013,6365,4288,4854,4938,5394,5070,54
73,5543,5965,5104,5587,5603,6040,5645,6069,6137,
6502,5146,5622,5700,6136,5831,6176,6215,6565,5884,6253,6
305,6665,6360,6723,6790,7064,4346,5069,5090,5582,5147,5600,5680,6080,5221,5726,5825,6170,5865,6212,6255,
6653,5510,5830,5904,6240,5958,6311,6362,6720,6071,6363,6497,6788,6562,6880,6937,7196,5602,5960,6046,633
6,6087,6409,6528,6824,6179,6534,6567,6936,6652,6952,6988,7255,6243,6607,6667,6984,6726,6991,7031,7334,68
26,7067,7137,7403,7194,7469,7471,7947,4364,5161,5200,5827,5472,5846,5885,6252,5577,5911,5963,6338,6067,6
376,6501,6791,5607,6012,6085,6379,6168,6529,6600,6883,6213,6650,6566,6941,6721,6987,7027,7330,5841,6139,
6175,6560,6250,6602,6666,6956,6309,6668,6725,7024,6789,7029,7070,7402,6408,6785,6828,7065,6939,7139,719
5,7465,6953,7249,7254,7537,7333,7540,7542,7944,5959,6178,6308,6669,6367,6724,6786,7030,6499,6830,6882,71
36,6942,7192,7253,7470,6503,6940,6957,7248,7026,7328,7329,7541,7068,7335,7401,7543,7407,7788,7790,8040,6
654,6990,7025,7331,7071,7400,7404,7785,7193,7464,7468,7789,7538,7791,7948,8042,7198,7536,7539,7945,7784,
7946,7949,8043,7786,7950,7951,8044,8041,8045,8046,8047,256,257,258,263,259,392,395,592,260,394,397,596,49
6,657,659,998,261,396,398,656,499,662,759,1034,502,758,754,1081,889,1121,1185,1550,262,497,501,752,503,757,
827,1083,597,831,891,1124,993,1224,1229,1589,658,893,996,1227,1033,1270,1331,1670,1080,1333,1415,1808,14
38,1834,1956,2377,393,498,594,830,598,890,992,1187,660,997,894,1230,1037,1309,1409,1725,756,995,1039,1332
1085,1412,1437,1814,1127,1464,1560,1914,1588,1980,2030,2513,829,1082,1125,1436,1225,1470,1567,1977,1266,
1584,1669,2006,1745,2063,2164,2632,1335,1723,1811,2101,1832,2165,2229,2715,1953,2315,2370,2801,2419,285
2,3024,3530,399,593,599,994,663,1032,1035,1408,824,1038,1086,1435,1184,1469,1547,1976,888,1087,1186,1471,
1228,1566,1666,2024,1308,1667,1724,2058,1813,2109,2223,2675,954,1190,1267,1587,1310,1668,1748,2102,1434,
1809,1833,2167,1952,2314,2335,2800,1546,1855,1978,2319,2007,2383,2421,2848,2098,2486,2574,2963,2656,307
8,3207,3531,958,1271,1411,1751,1468,1815,1919,2317,1551,1954,1982,2376,2031,2420,2512,2941,1664,

2025,2059,2484,2166,2570,2634,3084,2217,2658,2718,3130,2808,3248,3310,3811,1747,2103,2196,2593,2328,2674,2745,3202,2418,2773,2849,3290,2964,3331,3487,3955,2511,2914,3025,3428,3076,3525,3601,4063,3205,3636,3691,4058,3779,4202,4333,4860,500,661,753,1084,825,1120,1188,1565,826,1189,1231,1590,1328,1744,1752,2221,895,1264,1329,1755,1413,1812,1853,2222,1439,1852,1957,2369,2026,2417,2432,2831,956,1410,1465,1757,1562,1912,1979,2416,1586,2004,2052,2480,2062,2538,2597,3074,1585,2060,2105,2537,2216,2635,2677,3131,2330,2747,2809,3239,2913,3309,3431,3899,999,1549,1563,2000,1643,2056,2104,2514,1671,2111,2195,2633,2230,2714,2772,3235,1955,2226,2329,2717,2378,2806,2912,3304,2506,2917,3030,3414,3087,3524,3603,4048,2055,2372,2481,2830,2536,2962,3032,3496,2626,3081,3097,3529,3232,3651,3725,4153,2719,3206,3249,3708,3305,3786,3663,4219,3450,3896,3968,4379,4003,4537,4622,4926,1036,1591,1665,2199,1913,2313,2334,2746,2001,2368,2379,2825,2487,2919,3027,3500,2053,2485,2517,2940,2592,3033,3093,3577,2659,3101,3191,3639,3291,3711,3810,4223,2220,2539,2596,3092,2676,3184,3255,3688,2824,3268,3311,3798,3451,3771,3919,4383,2961,3410,3522,3897,3582,4002,4054,4492,3660,4061,4060,4602,4220,4669,4741,5169,2371,2657,2768,3269,2918,3330,3430,3865,3031,3497,3526,3969,3633,4009,4059,4527,3094,3589,3689,4049,3726,4062,4221,4670,3864,4241,4318,4766,4414,4882,4918,5365,3238,3709,3794,4222,3918,4232,4406,4777,3954,4401,4494,4892,4582,5001,5122,5534,4010,4568,4660,5029,4722,5131,5075,5624,4846,5209,5273,5770,5407,5858,5915,6234,595,755,828,1126,892,1265,1330,1749,955,1334,1414,1754,1467,1836,1854,2380,957,1466,1548,1835,1564,2057,2099,2510,1720,2100,2198,2627,2312,2708,2769,3289,959,1561,1642,2061,1722,2197,2227,2662,1750,2316,2340,2774,2382,2853,2943,3336,1810,2373,2423,2916,2515,3026,3079,3484,2571,3075,3122,3588,3129,3638,3710,4335,1191,1721,1746,2231,1756,2341,2381,2827,1915,2433,2507,2967,2573,3083,3100,3502,1983,2509,2595,3077,2661,3128,3173,3606,2716,3174,3190,3724,3383,3787,3878,4400,2 054,2660,2712,3187,2803,3254,3288,3750,2855,33 82,3441,3 857,3528,3914,4000,4495,2966,3486,3 583,4001,366 1,4015,4155,4583,3791,4176,4252,4671,4319,4769,4886,5341,1226,1753,1837,2422,1981,2508,2575,3086,2027,2624,2663,3175,2744,3204,3233,3727,2110,2713,2802,3234,2854,3377,3429,3812,2965,3482,3527,3953,3607,4011,4086,4524,2228,2826,2942,3440,3080,3523,3503,4012,3095,3600,3637,4066,3751,4174,4216,4697,3203,3662,3789,4203,3813,4299,4332,4778,3887,4382,4450,4893,4601,5005,5123,5535,2331,2991,3082,3602,3172,3650,3770,4177,3339,3790,3872,4314,3875,4334,4412,4881,3411,3873,3886,4405,4013,4437,4573,5000,4148,4600,4651,5060,4740,5172,5230,5631,3483,4055,4084,4525,4217,4603,4668,5085,4253,4728,4779,5208,4887,5304,5385,5777,4464,4805,4912,5311,5019,5433,5458,5913,5100,5497,5609,5980,5694,6104,6219,6539,1311,1918,2005,2625,2108,2709,2775,3308,2194,2807,2915,3379,2990,3449,3576,4087,2318,2960,3085,3501,3123,3649,3632,4152,3185,3690,3778,4240,3866,4302,4357,4847,2516,3096,3186,3648,3338,3749,3795,4315,3378,3867,3877,4378,3915,4413,4469,4980,3412,3898,4008,4468,4109,4572,4623,5061,4206,4701,4729,5173,4804,5231,5338,5750,2572,3337,3376,3856,3413,3874,3952,4436,3485,4014,4067,4536,4175,4618,4723,5143,3788,4108,4218,4650,4254,4767,4826,5210,4415,4827,4913,5328,5028,5432,5449,5912,3876,4298,4404,4768,4465,4889,4982,5340,4575,5004,5063,5448,5142,5526,5630,5991,4661,5101,5177,5608,5272,5639,5735,6124,5364,5771,5811,6163,5876,6329,6347,6773,2594,3415,3448,4085,3748,4154,4207,4700,3799,4233,4303,4776,4407,4880,4927,5339,3879,4356,4451,4883,4526,4983,5074,5437,4619,5130,5062,5493,5211,5625,5693,6034,4149,4493,4569,5018,4696,5084,5176,5548,4765,5180,5265,5660,5329,5695,5780,6162,4888,5305,5384,5751,5459,5859,5877,6273,5527,5945,5990,6417,6105,6450,6478,6712,4255,4574,4764,5181,4861,5264,5310,5734,4919,5406,5436,5810,5496,5860,5981,6346,4981,5492,5549,5944,5692,6006,6007,6451,5776,6125,6153,6479,6235,6616,6642,6996,5168,5638,5661,6035,5781,6152,6218,6513,5861,6272,6328,6617,6442,6643,6838,7238,5914,6416,6443,6713,6512,6772,6839,7239,6538,6910,6911,7506,6997,750

7,7642,7643,952,953,1122,1433,1123,1544,1641,2028,1268,1640,1727,2106,1838,2219,2225,2910,1269,1726,1758,2218,1917,2342,2505,2938,2002,2504,2434,3035,2631,3121,3189,3706,1432,1839,1959,2374,2003,2483,2569,3073,2107,2629,2673,3132,2829,3252,3307,3797,2224,2679,2908,3271,2937,3380,3443,3884,3034,3481,3579,4052,3604,4104,4204,4703,1545,1916,2096,2628,2192,2672,2828,3201,2332,2909,2710,3328,2989,3409,3495,3941,2482,2851,3029,3480,3099,3520,3591,4068,3135,3634,3720,4178,3796,4228,4316,4845,2599,3072,3133,3590,3253,3692,3777,4225,3342,3784,3871,4296,3943,4377,4466,4978,3493,3917,4057,4403,4070,4467,4571,5077,4183,4591,4662,5137,4743,5190,5332,5816,1759,2029,2193,2850,2343,2936,2939,3494,2518,3028,3102,3581,3188,3659,3695,4224,2630,3103,3200,3693,3306,3776,3868,4300,3408,3869,3940,4372,4065,4439,4541,5031,2770,3250,3343,3793,3424,3870,3972,4416,3580,4053,4071,4471,4182,4590,4649,5136,3694,4151,4226,4607,4297,4733,4761,5188,4380,4806,4914,5275,5006,5366,5545,5817,2810,3381,3499,3975,3658,4069,4181,4605,3707,4200,4230,4702,4317,4760,4844,5267,3858,4301,4373,4774,4470,4890,5002,5386,4491,5016,5086,5480,5170,5554,5628,6059,3971,4417,4474,4917,4616,5030,5103,5524,4742,5121,5189,5594,5306,5637,5775,6189,4843,5228,5333,5706,5354,5805,5873,6275,5533,5890,5947,6264,6033,6344,6469,6810,1958,2333,2375,3098,2519,3120,3236,3769,2568,3237,3329,3808,3426,3942,4004,4539,2711,3340,3427,4007,3521,4064,4111,4540,3605,4110,4205,4659,4312,4735,4770,5183,2804,3498,3635,4051,3722,4172,4227,4734,3792,4242,4328,4772,4376,4884,4923,5352,3785,4374,4419,4867,4490,5003,5037,5481,4620,5117,5171,5553,5215,5627,5733,6155,2911,3705,3723,4234,3815,4358,4418,4862,3885,4449,4473,4979,4580,5076,5120,5551,4201,4542,4617,5079,4720,5140,5214,5610,4824,5245,5336,5704,5389,5804,5875,6260,4331,4698,4773,5182,4866,5274,5342,5778,4976,5373,5435,5809,5546,5925,5983,6319,5087,5544,5555,5948,5611,6036,5933,6373,5754,6130,6190,6493,6207,6595,6678,6896,2988,3809,3859,4489,4173,4589,4648,5116,4235,4658,4721,5175,4807,5247,5335,5782,4329,4775,4865,5266,4916,5343,5391,5819,5017,5439,5499,5921,5595,5951,6058,6393,4538,4885,4922,5390,5036,5486,5557,5934,5174,5558,5629,6056,5755,6027,6159,6495,5271,5688,5794,6131,5856,6206,6262,6558,5926,6267,6266,6640,6374,6697,6747,7023,4663,5007,5118,5559,5246,5636,5732,6089,5337,5779,5806,6191,5889,6217,6265,6593,5404,5863,5935,6261,5988,6274,6375,6698,6088,6419,6448,6754,6522,6822,6890,7147,5552,5949,6050,6392,6158,6394,6514,6763,6188,6505,6580,6850,6636,6917,7004,7222,6232,6618,6682,6931,6742,7007,6973,7290,6808,7051,7103,7374,7151,7418,7479,7606,2097,2435,2598,3134,2678,3341,3442,3973,2771,3492,3578,4006,3657,4106,4150,4730,2805,3656,3704,4105,3768,4359,4381,4842,3912,4402,4488,4977,4588,5038,5119,5593,2811,3721,3814,4375,3916,4475,4543,5022,3974,4604,4656,5128,4732,5191,5269,5652,4056,4699,4763,5244,4863,5334,5367,5772,4891,5353,5450,5862,5457,5920,5950,6471,3251,3913,3970,4581,4050,4657,4731,5179,4179,4771,4825,5309,4895,5375,5438,5792,4231,4841,4921,5355,5021,5456,5483,5878,5078,5484,5498,5982,5671,6037,6126,6504,4330,5020,5072,5495,5139,5556,5592,6024,5213,5670,5749,6079,5808,6156,6204,6581,5308,5774,5857,6205,5927,6239,6331,6637,6049,6334,6420,6699,6449,6761,6836,7145,3270,4005,4107,4762,4229,4840,4915,5388,4313,4924,5023,5485,5102,5532,5547,5989,4448,5073,5138,5550,5212,5663,5707,6076,5307,5768,5807,6161,5879,6233,6292,6582,4570,5178,5268,5748,5372,5795,5793,6236,5405,5872,5891,6280,6025,6332,6354,6715,5525,5932,6039,6345,6077,6429,6468,6774,6129,6494,6552,6851,6639,6919,7005,7223,4621,5331,5374,5874,5482,5924,6026,6335,5655,6048,6106,6440,6121,6470,6520,6821,5689,6107,6128,6507,6237,6537,6625,6916,6316,6638,6681,6968,6746,7040,7086,7305,5769,6263,6282,6583,6355,6641,6696,6975,6421,6744,6775,7050,6837,7104,7149,7381,6554,6801,6888,7107,6929,7177,7202,7477,6998,7215,7289,7532,7348,7564,7605,7775,3425,4180,4243,4925,4438,5039,5129,5626,4472,5141,5229,5669,5330,5753,5818,6293,4606,5270,5387,5783,5451,5923,5888,6318,5487,5946,6032,6418,6090,6430,6477,6809,4864,5434,5494,5922,5654,6005,6051,6441,5668,6091,6123,6492,6157,6521,6557,6898,5690,6154,6216,6556,6295,6624,6679,6969,6352,6741,6745,7041,6800,7087,7122,7372,4894,5653,5662,6078,5691,6120,6160,6536,5773,6238,6281,6594,6333,6676,6743,7021,6038,6294,6372,6680,6422,6755,6802,7084,6523,6803,6889,7120,6930,7176,7201,7476,6122,6428,6506,6760,6555,6849,6908,7144,6627,6918,6971,7200,7020,7220,7304,7535,6683,6999,7043,7288,7102,7307,7351,7566,7146,7375,7417,7587,7450,7669,7671,7851,4920,5705,5752,6283,6004,6330,6353,6740,6057,6395,6431,6762,6515,6820,6897,7123,6127,6476,6553,6823,6592,6909,6972,7179,6677,7006,6970,7213,7085,7291,7323,7550,6317,6559,6619,6928,6714,6974,7042,7236,6753,7048,7101,7320,7121,7349,7382,7586,6848,7105,7148,7373,7203,7419,7451,7641,7221,7505,7534,7697,7565,7736,7738,7848,6423,6626,6752,7049,6811,7100,7106,7350,6891,7150,7178,7416,7214,7448,7533,7670,6899,7212,7237,7504,7322,7548,7549,7737,7380,7567,7585,7739,7607,7812,7814,8068,7022,7306,7321,7551,7383,7584,7604,7773,7449,7640,7668,7813,7698,7815,7980,8070,7478,7696,7699,7849,7772,7850,7981,8071,7774,7982,7983,8116,8069,8117,8118,8119,1304,1305,1306,1647,1307,1848,1851,2436,1644,1850,2049,2540,2160,2637,2639,3294,1645,2048,2050,2636,2163,2706,2815,3334,2338,2814,2750,3453,3037,3533,3653,4146,1646,2161,2337,2748,2339,2813,2907,3455,2541,2987,3039,3584,3265,3684,3745,4245,2638,3089,3292,3687,3333,3782,3883,4310,3452,3901,3959,4476,3990,4546,4652,5157,1849,2162,2438,2986,2542,3038,3264,3655,2704,3293,3090,3746,3445,3861,3937,4369,2812,3267,3447,3900,3489,3956,3989,4522,3587,4040,4156,4586,4244,4704,4782,5313,2985,3454,3585,3988,3685,4046,4171,4665,3774,4236,4309,4726,4409,4859,4956,5444,3903,4355,4479,4897,4544,4957,5033,5519,4613,5059,5134,5569,5227,5656,5756,6226,2051,2437,2543,3266,2707,3332,3335,3936,2904,3446,3490,3987,3652,4045,4083,4664,3036,3491,3654,4047,3744,4170,4306,4736,3860,4307,4368,4830,4521,4953,4999,5491,3126,3682,3775,4239,3862,4308,4420,4898,3986,4477,4545,4959,4612,5058,5115,5568,4082,4579,4666,5083,4727,5187,5241,5648,4870,5278,5370,5719,5452,5802,5943,6227,3170,3783,3939,4423,4044,4523,4611,5081,4147,4614,4706,5156,4783,5240,5312,5713,4304,4737,4831,5276,4958,5362,5446,5820,4993,5454,5522,5894,5596,5976,6030,6455,4411,4899,4972,5401,5096,5490,5529,5938,5226,5565,5649,6018,5728,6055,6167,6547,5303,5674,5757,6116,5800,6221,6277,6623,5941,6296,6327,6614,6407,6706,6805,7124,2336,2705,2749,3488,2905,3532,3680,4169,2906,3681,3747,4246,3880,4408,4432,4997,3091,3772,3881,4435,3957,4520,4577,4998,3991,4576,4653,5133,4738,5225,5256,5635,3168,3938,4041,4453,4158,4584,4667,5224,4238,4724,4800,5260,4858,5358,5409,5798,4237,4856,4901,5357,4992,5447,5501,5895,5098,5531,5597,5975,5673,6029,6119,6511,3295,4145,4159,4708,4251,4828,4900,5314,4311,4955,4971,5445,5034,5518,5564,5971,4615,5026,5097,5521,5158,5574,5672,6020,5298,5677,5786,6110,5823,6220,6279,6596,4803,5152,5261,5634,5356,5718,5788,6192,5414,5813,5837,6225,5968,6303,6389,6685,5523,5942,5977,6368,6021,6426,6323,6719,6146,6508,6548,6835,6575,6921,6994,7182,3444,4247,4305,4975,4585,5057,5114,5530,4709,5132,5159,5613,5279,5679,5759,6196,4801,5277,5317,5712,5400,5789,5833,6229,5455,5849,5931,6299,6019,6371,6454,6731,4996,5359,5408,5832,5500,5916,5987,6324,5612,6000,6031,6446,6147,6403,6527,6843,5717,6102,6202,6509,6258,6574,6610,6904,6320,6621,6620,6966,6728,7017,7061,7293,5135,5453,5560,6001,5678,6054,6118,6465,5787,6193,6222,6549,6289,6585,6615,6915,5834,6269,6325,6597,6390,6622,6729,7018,6464,6757,6794,7078,6858,7134,7170,7397,5974,6369,6438,6730,6526,6748,6854,7093,6546,6845,6906,7160,6950,7205,7274,7482,6586,6932,7012,7229,7046,7279,7247,7512,7118,7317,7357,7582,7427,7622,7647,7762,2439,2751,2984,3586,3088,3773,3882,4421,3127,3902,3958,4434,4043,4548,4578,5184,3169,4042,4144,4547,4168,4829,4871,5302,4352,4896,4974,5415,5056,5512,5561,6017,3171,4157,4250,4857,4354,4973,5027,5462,4422,5080,5124,5566,5186,5657,5715,6060,4478,5153,5243,5676,5315,5758,5803,6164,5363,5799,5854,6268,5893,62 98,6370,6807,3683,4353,4410,5035,4452,5125,5185,5615,4587,5257,5299,5731,5369,5815,5848,6198,4707,5301,5403,5801,5461,5892,5901,6286,5520,5902,5930,6388,6099,6427,6486,6844,4802,5460,5516,5919,5571,5986,6016,6398,5659,6098,6133,6461,6224,6518,6572,6907,5730,6166,6259,6573,6321,6591,6687,6951,6435,6692,6764,7019,6795,7081,7154,7389,3686,4433,4549,5242,4705,5300,5371,5822,4739,5412,5463,5903,5528,5940,5969,6391,4954,5517,5570,5970,5658,6093,6117,6456,5729,6150,6223,6545,6287,6587,6646,6912,5032,5614,5714,6132,5812,6203,6199,6588,5835,6276,6297,6630,6399,6690,6716,7033,5939,6322,6433,6707,6457,6771,6804,7094,6491,6842,6870,7161,6965,7209,7275,7483,5099,5747,5814,6278,5900,6302,6402,6693,6063,6434,6480,6782,6483,6806,6856,7133,6103,6481,6490,6853,6589,6865,6945,7204,6672,6964,7003,7240,7060,7296,7338,7519,6151,6611,6644,6913,6717,6967,7016,7261,6765,7052,7095,7316,7155,7360,7413,7593,6872,7097,7164,7367,7219,7429,7442,7645,7264,7461,7509,7672,7558,7716,7759,7883,3863,4610,4725,5413,4952,5513,5567,6028,4970,5575,5675,6095,5746,6145,6228,6647,5082,5716,5821,6197,5855,6301,6288,6684,5917,6326,6406,6756,6466,6778,6813,7119,5316,5836,5918,6300,6062,6397,6439,6783,6094,6467,6485,6834,6519,6857,6877,7188,6108,6510,6584,6876,6661,6944,6995,7241,6710,7037,7053,7297,7096,7339,7386,7574,5368,6061,6092,6460,6109,6482,6544,6864,6165,6590,6631,6920,6691,6982,7047,7287,6432,6660,6718,7002,6766,7079,7110,7318,6859,7111,7165,7368,7228,7428,7437,7644,6484,6770,6852,7080,6873,7157,7190,7388,6947,7208,7243,7436,7286,7474,7518,7679,7013,7265,7301,7508,7356,7523,7571,7724,7396,7583,7615,7747,7632,7805,7819,7957,5402,6111,6144,6645,6396,6686,6711,7036,6447,6749,6779,7092,6855,7132,7183,7387,6487,6812,6871,7135,6914,7191,7246,7433,6983,7278,7242,7457,7319,7513,7557,7690,6673,6905,6933,7218,7032,7260,7300,7488,7077,7308,7345,7528,7369,7559,7596,7746,7156,7361,7412,7575,7443,7623,7633,7781,7475,7661,7678,7833,7717,7854,7862,7928,6767,6946,7076,7309,7125,7344,7366,7570,7171,7426,7432,7614,7460,7624,7673,7818,7189,7456,7489,7660,7556,7682,7683,7855,7592,7725,7733,7863,7763,7900,7914,8012,7292,7522,7529,7691,7597,7732,7758,7873,7625,7780,7804,7901,7846,7915,7974,8086,7646,7832,7847,7929,7872,7956,7975,8087,7882,7994,7995,8130,8013,8131,8154,8155,3124,3125,3534,3985,3535,4080,4249,4780,3780,4248,4371,4902,4550,4995,5025,5666,3781,4370,4454,4994,4609,5126,5297,5710,4710,5296,5258,5791,5443,5853,5929,6358,3984,4551,4655,5154,4711,5263,5361,5797,4903,5441,5489,5896,5633,5984,6023,6445,5024,5503,5664,6003,5709,6096,6135,6488,5790,6149,6231,6608,6284,6656,6708,7039,4081,4608,4868,5440,4968,5488,5632,5937,5112,5665,5514,6052,5745,6101,6187,6541,5262,5651,5785,6148,5839,6200,6271,6632,5899,6290,6384,6694,6444,6736,6792,7117,5411,5796,5897,6270,5985,6348,6405,6733,6074,6424,6475,6768,6543,6833,6874,7186,6185,6525,6613,6847,6634,6875,6935,7257,6703,6963,7014,7281,7063,7314,7376,7616,4455,4781,4969,5650,5127,5708,5711,6186,5318,5784,5850,6257,5928,6315,6351,6732,5442,5851,5936,6349,6022,6404,6472,6776,6100,6473,6540,6816,6629,6867,6925,7231,5562,5978,6075,6437,6112,6474,6568,6860,6256,6609,6635,6879,6702,6962,7001,7280,6350,6675,6734,6979,6769,7057,7073,7312,6840,7098,7166,7359,7210,7398,7485,7617,5598,6097,6195,6571,6314,6633,6701,6977,6359,6704,6738,7038,6793,7072,7116,7347,6462,6777,6817,7090,6878,7158,7206,7414,6903,7216,7262,7444,7294,7494,7516,7707,6551,6861,6894,7169,6980,7230,7267,7472,7062,7273,7313,7502,7362,7521,7591,7749,7115,7336,7377,7562,7394,7609,7629,7783,7481,7638,7663,7776,7689,7816,7857,7966,4654,5113,5155,5838,5319,5852,5972,6401,5360,5973,6053,6452,6114,6542,6576,6923,5515,6072,6115,6579,6201,6628,6663,6924,6285,6662,6709,7011,6780,7059,7082,7311,5572,6194,6291,6599,6386,6688,6735,7058,6436,6758,6796,7088,6832,7152,7175,7392,6425,6818,6863,7131,6902,7207,7233,7445,6992,7269,7295,7493,7327,7515,7569,7735,5667,6357,6387,6750,6459,6814,6862,7126,6489,6869,6893,7187,6948,7256,7272,7491,6705,6926,6981,7259,7044,7284,7326,7510,7108,7341,7384,7560,7421,7608,7631,7768,6799,7034,7089,7310,7130,7

358,739 0,7594,7184,7409,7431,7613,7486,7653,7675,7803,7 263,7484,7495,7664,7511,7692,7657,7825,7578,7730 ,7750,78 65,7755,7899,7918,7988,5744,6453,6463,6901,6689, 6961,7000,7268,6751,7010,7045,7299,7099,7343,737 9,7598,6 797,7091,7129,7346,7168,7391,7423,7619,7217,7435 ,7463,7649,7503,7667,7706,7829,6922,7153,7174,74 22,7232, 7454,7497,7658,7298,7498,7517,7704,7579,7687,774 3,7867,7355,7552,7602,7731,7620,7754,7770,7890,7 654,777 9,7778,7912,7826,7925,7939,8023,7015,7211,7270,7 499,7342,7520,7568,7713,7385,7595,7610,7751,7637 ,7757,77 77,7897,7424,7627,7659,7769,7676,7782,7827,7926, 7712,7835,7852,7942,7878,7970,7986,8059,7492,766 5,7702,7 828,7742,7830,7874,7955,7748,7869,7892,7978,7908 ,7997,8016,8082,7760,7902,7922,8003,7934,8019,80 09,8090, 7964,8031,8039,8106,8063,8114,8127,8150,4869,525 9,5410,5898,5502,6073,6134,6569,5563,6184,6230,6 578,631 3,6658,6674,7054,5573,6312,6356,6657,6400,6815,6 841,7114,6516,6846,6900,7185,6960,7234,7271,7501 ,5599,63 85,6458,6819,6524,6895,6927,7226,6570,6976,7008, 7276,7056,7315,7353,7524,6612,7035,7075,7340,712 7,7378,7 399,7588,7159,7393,7438,7626,7441,7648,7666,7859 ,5979,6517,6550,6949,6598,7009,7055,7303,6695,70 83,7109, 7365,7163,7411,7434,7600,6739,7113,7173,7395,722 5,7440,7447,7634,7258,7452,7462,7674,7547,7693,7 726,786 8,6798,7224,7244,7459,7283,7496,7500,7684,7325,7 546,7573,7711,7612,7740,7752,7893,7364,7590,7621 ,7753,76 55,7767,7807,7909,7701,7810,7836,7927,7853,7953, 7972,8057,6002,6577,6659,7074,6737,7112,7167,742 0,6781,7 180,7227,7453,7266,7480,7487,7677,6868,7245,7282 ,7490,7324,7531,7563,7708,7363,7580,7611,7745,76 35,7761, 7796,7894,6934,7302,7352,7572,7408,7603,7601,776 4,7425,7628,7639,7792,7685,7808,7822,7931,7473,7 656,769 5,7817,7709,7841,7856,7958,7729,7866,7884,7979,7 911,7999,8017,8083,6993,7371,7410,7630,7446,7652 ,7686,78 11,7527,7700,7718,7844,7721,7858,7876,7969,7553, 7719,7728,7871,7765,7881,7905,7996,7800,7910,792 1,8004,7 938,8024,8034,8093,7581,7771,7794,7895,7823,7913 ,7924,8011,7837,7936,7959,8030,7973,8048,8061,81 09,7886, 7961,7984,8051,8001,8065,8074,8125,8014,8079,808 9,8132,8100,8140,8149,8171,6113,6700,6759,7181,6 866,723 5,7277,7514,6892,7285,7337,7545,7370,7577,7618,7 797,6978,7354,7415,7599,7439,7651,7636,7802,7455 ,7662,76 88,7834,7714,7842,7861,7965,7128,7430,7458,7650, 7526,7681,7703,7845,7544,7715,7723,7864,7741,787 7,7889,7 990,7554,7734,7756,7888,7799,7904,7919,8005,7820 ,7933,7937,8025,7960,8035,8054,8104,7162,7525,75 30,7710, 7555,7720,7744,7880,7589,7766,7793,7898,7809,791 6,7935,8021,7694,7798,7824,7920,7838,7943,7962,8 032,787 9,7963,7985,8052,8002,8064,8073,8124,7722,7840,7 870,7952,7887,7977,7992,8056,7907,7998,8007,8072 ,8020,80 80,8092,8135,7923,8015,8027,8088,8038,8095,8103, 8142,8058,8107,8113,8147,8122,8157,8159,8179,717 2,7561,7 576,7795,7680,7806,7821,7932,7705,7831,7843,7954 ,7875,7968,7989,8055,7727,7860,7885,7971,7896,79 93,8008, 8067,7917,8018,8006,8077,8033,8091,8099,8138,780 1,7891,7903,8000,7930,8010,8026,8084,7941,8028,8 037,809 6,8053,8101,8110,8146,7976,8049,8060,8105,8075,8 115,8123,8153,8081,8129,8134,8161,8141,8164,8166 ,8176,78 39,7906,7940,8029,7967,8036,8050,8102,7987,8062, 8066,8112,8078,8120,8133,8158,7991,8076,8085,812 8,8098,8 136,8137,8165,8108,8143,8145,8167,8151,8172,8174 ,8184,8022,8094,8097,8139,8111,8144,8148,8169,81 21,8152, 8156,8173,8162,8175,8180,8186,8126,8160,8163,817 7,8168,8178,8181,8187,8170,8182,8183,8188,8185,8 189,819 0,8191]

**Sequence group 2: Q2_16384**

[0,1,2,4,8,16,32,3,5,64,9,6,17,10,18,128,12,3 3,65,20,256,34,24,36,7,129,66,512,11,40,68,130,19,1 3,48,1 4,72,257,21,132,35,258,26,513,80,37,25,22,136,260,2 64,38,514,96,67,41,144,28,69,42,516,49,74,272,1024, 1025,16 0,520,288,528,192,544,70,44,131,81,50,73, 15,320, 133,52,23, 134,384,76,137,82,56,27,97,39,259,84,138,145,261,2 9, 1026,1028,43,98,515,88,140,30,146,71,262,265,161,5 76,45,100,640,51,148,46,75,266,273,517,104,162,103 2,1040, 53,193,2048,2049,2050,2052,152,77,164,768,268,274 ,518,54,83,57,521,112,135,78,289,194,85,276,522,58, 1056,10 27,168,139,99,86,60,280,89,290,529,524,196,141,101,147,1029,1088,176,142,530,321,31,200,90,545,292,322,532, 263,149,102,105,304,296,163,92,47,267,385, 1033, 1030,546,324,2056,2064,2080,2051,208,386, 150, 153, 165, 106,55, 328,536,577,548,113,154,79,1041,1034,269,108,578, 224,166,519,552,195,270,641,523,275,580,291,1042, 1152,59, 169,560,114,277,156,87,197,116,170,61,531,525,642, 1036,1057,2053,2112,2057,2054,281,278,526,177,4096,4097, 4098,4100,4104,4112,4128,4099,293,388,91,584,1089,1044,769,198,172,120,201,336,62,282,1280,1058,143,103,178,294,93,644,202,592,323,392,1048,1060,297,770,107,180,151,209,284,648,1031,1153,94,204,2065,2058,2066,2176,298,400,608,352,325,533,155,210,305,547,300,109,1090,1536,184,534,537,115,167,225,326,306,1035, 1064,772, 157,656,329,2060,2081,2113,2068,110,117,212,171,1092,1154,776,330,226,549,538,387,308,216,1043,1037,416,271,279,158,1072,1038,337,550,672,118,332,579,540, 389,173,121,553,199,784,179,228,338,312,704,1096, 1281,390, 174,2304,2082,2072,2084,554,581,1045,1156,4101,4160,4105,4102,4113,4106,4114,4224,393,283,122,448,353,561,1059,1282,203,63,340,394,527,582,556,181,295,285,232,124,205,182,643,562,286,585,1050,1537,2055, 2177,2114,2560,299,354,1104,1061,211,401,185,396,1049,1046,344,586,645,593,535,240,206,95,327,564,800,402,1160,1284,356,307,301,417,2059,2088,2116,2178,1288,1062,213,568,832,588,186,646,404,227,896,594,418,302,1538,1120, 649,771,360,539,1091,1065,1168,1052,111,331,214,309,2067,2061,2096,2062,4108,4129,4161,4116,4352, 4130,4120,4132,188,449,217,408,609,596,551,650,8192,8193,8194,8196,8200,8208,8224,8195,8197,8256,8201,8198,8209, 8202,8210,8320,1093,1066,229,159,420,310,1540,1073,2120,2305,2069,2180,541,773,1098,1296,610,657, 333,119, 600,339,218,368,652,230,391,313,2083,2306,2074,2561,450,542,1184,1544,334,233,555,774,175,123,658, 612,1312,1552,341,777,220,314,1216,1568,2128,2085,2073,2070,424,395,673,583,1094,1068,355,287,183,234,1155,1105, 125,557,660,616,2184,2308,2312,2086,1074,1097,1039,1344,4103,4225,4162,4608,4107,4136,4164,4226, 342,316, 241,778,563,345,452,397,1157,1076,1047,1158,403,207,674,558,785,432,357,187,236,664,624,587,2562,2144,211 5,2089,1408,1100,780,705,126,242,565,398,1161,1106,346,456,358,405,1080,1051,2192,2076,2117,2090,1121,1063,303,569,244,595,189,566,4115,4109,4144,4110,4168,4353,4117,4228,676,361,706,589,215,786,647,348, 2564,2097,2122,2320,419,406,464,680,801,362,1283,1108,590,409,1162,1169,1285,1053,570,788,3072,3073,2208, 2568,597,572,219,311,1067,1122,1539,1112,2336,2576,2240, 2592,708,598,601,651,421,792,802,611,1164,1054,602,410,1170,1095,231,688,653,248,369,190,364,654,659,335,1286,1289,480,315,221,370,1185,1600,1069,1124,613, 422,2118,2092,2179,2129,425,451,1664,1075,4131,4354,4122,4609,4176,4133,4121,4118,614,543,235,412,2098,2121,2063,2368,8204,8225,8257,8212,8448,8226,8216,8228,8199,8321,8258,8704,8203,8232,8260,8322,343,372,1172,1070, 775,317,222,426,1099,1290,453,237,2181,2100,2071, 2182,559,833,804,712,1297,1541,1128,1186,834,661, 808,779,1077,1217,617,604,1176,1101,433,720,816,836,347,897,1188,1792,1292,1298,243,662,454,318,675,618, 1542,1078,2432,2124,2185,2130,4232,4356,4360,4134,4610, 4192,4163,4137,898,781,376,428,2104,2075,2145,2087,1107, 1081,665,736,567,840,625,238,2307,2132,2186,2193, 1545,1136,1159,1102,359,457,1313,1218,399,787,591,678,1109,1300,434,677,349,245,458,666,620,363,127,191,2309,2077,3074,3076,782,407,1546,1082,1192,1163,436,626,4240,4124,4165,4138,4612,4145,4170,4368,2091,2146,2563,2136,571,465,1123,1110,681,246,707,350,1084,1304,599,668,790,460,1113,1314,249,682,573,411,803,789, 709,365,2188,2078,2194,2119,1553,1548,1220,1165, 440,628, 689,374,2310,2313,2209,2624,2093,2148,2688,2099, 423,466,793,250,1125,1171,1200,1166,5120,5121,4256,4616, 4384,4624,4288,4640,8211,8205,8240,8206,8264,8449,8213,8324,8227,8450,8218,8705,8272,8229,8217,8214,1554,1345,1055,1224,371,481,574,413,1114,1569,1316,1346,603,366,468,655,2196,2094,2123,2314,900,805,615,684, 1556,1287,710,429,2321,2565,2152,2210,4166,4140, 4227,4177,4146,4169,4111,4416,1173,1126,794,252, 3080,3088,2101,2241,1129,1328,373,605,848,690,713,632,1320,1187,482,806,1116,1071,427,904,1291,1409,414,223,663,692,1570,1348,4229,4148,4119,4230,4480,4172,4233,4178,835,619,1232,1410,2200,2125,2212,2816,472,455,796,809,1174,1177,1189,1130,714,721,837,716,864,810,606,912,2316,2322,2566,2102,1079,1352,722,696,377,435,817,319,2131,2105,2569,2160,4152,4123,4193,4135,4355,4180,4234,4241,1560,1601,621,812,1572,1137,484,430,2183,2126,2337,2242,1178,1103,1293,1132,838,667,488,239,2133,2324,2570,2106,378,459,1602,1248,1190,1543,1576,1219,4357,4125,5122,5124,4139,4194,4611,4184,3104,3075,2216,2187,2147,2134,2108,2328,8328,8452,8456,8230,8706,8288,8259,8233,8336,8220,8261,8234,8708,8241,8266,8464,622,627,437,380,1294,1665,1547,1299,818,461,496,669,679,724,841,629,2137,2338,2577,2572,2244,2189,2149,2195,351,467,1604,1315,1083,1193,438,737,1584,1138,251,462,442,441,469,247,1301,1180,683,842,1111,1221,1140,1194,4236,4126,4242,4167,4358,4361,4257,4672,3077,3136,2224,2190,738,899,670,783,1085,1555,1549,1666,849,820,1305,1302,2578,2369,2079,2248,728,928,1550,1201,791,367,901,630,2138,2593,2340,2370,4141,4196,4736,4147,4244,4142,4171,4362,2580,2311,2197,2150,1317,1412,685,844,633,711,1115,1608,1793,1222,1196,1144,9216,9217,8352,8712,8480,8720,8384,8736,8262,8236,8323,8273,8242,8265,8207,8512,1225,1360,253,691,1086,1306,824,902,686,740,850,375,444,470,483,415,4369,4613,4200,4258,5128,5136,4149,4289,1167,1127,1202,1318,1117,1668,1226,1616,485,905,1347,1416,2153,2352,2344,2211,795,473,1321,1794,2140,2095,2315,2433,3081,3078,2594,2372,634,744,852,960,6144,6145,6146,6148,4248,4173,4260,4864,1131,1204,865,693,1175,1233,797,906,2256,2434,2198,2201,2213,2154,2103,2376,4364,4370,4614,4150,4179,4153,4617,4208,1308,1672,715,807,1118,1228,474,636,1322,1424,1632,1376,694,254,717,575,2584,2625,2596,2161,913,798,1349,1557,2202,2127,3089,3082,1179,1234,1329,1571,1324,1133,811,379,1208,1558,697,431,607,489,1561,1139,866,723,486,908,2317,2156,2626,2272,718,813,476,856,1191,1249,1350,1330,2214,2567,2600,2243,2318,2689,2571,2323,839,725,1796,1181,4231,4174,4385,4290,4181,4372,4618,4154,1680,1353,698,914,2628,2339,3090,3200,8325,8244,8215,8326,8576,8268,8329,8274,8248,8219,8289,8231,8451,8276,8330,8337,752,868,1134,1141,819,814,1236,1195,5152,5123,4264,4235,4195,4182,4156,4376,1800,1354,1250,1573,2107,2217,2608,2162,1562,1411,1332,1240,439,929,490,623,2325,2204,2135,2245,671,739,916,463,4185,4386,4625,4620,4292,4237,4197,4243,843,381,1440,1295,1303,1182,1361,1574,2164,2218,2109,2579,2573,2690,3084,3105,497,930,1696,1142,821,726,961,872,2329,2326,2574,2225,1356,1603,492,631,2341,2436,2139,2632,1564,1413,1197,1145,729,700,443,741,1577,1223,1808,1203,3137,3092,2817,2246,2220,2168,2249,2384,1252,1362,845,920,1336,1728,382,822,1414,1198,851,730,2110,2330,3328,3106,5125,5184,4272,4238,4626,4417,4127,4296,8453,8221,9218,9220,8235,8290,8707,8280,8332,8222,8338,8263,8454,8457,8353,8768,1578,1605,1417,1307,498,880,1146,1472,4186,4641,4388,4418,4628,4359,4245,4198,2191,2151,2226,2342,742,445,471,635,932,687,1377,1585,903,825,1227,1087,4201,4400,4392,4259,4188,4143,4363,4481,2141,2692,2250,2640,2371,2440,3096,3108,1364,1418,500,846,2345,2818,2155,2228,745,826,1551,1606,1580,1205,1319,1309,2199,2257,2332,2696,732,446,1256,1148,1229,1206,1667,1586,962,936,475,853,867,637,1310,1609,1323,1378,1235,1425,5129,5126,4642,4420,6152,6160,6176,6147,907,487,695,746,3079,3201,2142,2252,2346,2448,2656,2400,828,753,1209,1420,8237,8292,8832,8243,8340,8238,8267,8458,8465,8709,8296,8354,9224,9232,8245,8385,4304,4482,4246,4249,4261,4202,4151,4424,1368,1610,854,857,2373,2581,2203,2258,1669,1617,1559,1264,1230,1119,504,799,2353,2595,2348,2157,255,964,1351,1588,1824,1426,1380,1331,3138,3584,2232,2582,909,719,477,915,1325,1441,638,748,944,869,1237,1592,491,699,1856,1612,4632,4673,4644,4209,4250,4175,5137,5130,2585,2163,2215,2273,2374,2354,3083,3112,754,858,1210,1670,1428,1251,478,968,4365,4204,4674,4320,4262,4615,4648,4291,4366,4737,4619,4371,4676,4387,5138,5248,1920,1618,1442,1326,1673,1795,383,910,2820,2205,2704,2377,2158,2165,2260,2219,10240,10241,10242,10244,8344,8269,8356,8960,8460,8466,8710,8246,8275,8249,8713,8304,3140,3202,2824,2378,2274,2597,2586,2435,1384,1563,

1135,1355,815,976,870,917,2356,2264,3091,3085,24
64,2319,2327,2206,727,493,1238,1333,873,701,1212,
1473,41
55,4265,4656,4210,4373,4252,4183,4293,1241,1432,
931,756,1633,1620,1575,1674,3120,3086,2385,2598,
860,499,
1253,1183,4212,4266,4157,4627,4621,4738,5132,515
3,8327,8270,8481,8386,8277,8468,8714,8250,9248,9
219,836
0,8331,8291,8278,8252,8472,2720,2166,2380,2627,1
444,1334,1565,1797,6149,6208,6153,6150,4377,4374
,4622,42
73,2588,2437,2221,2169,731,823,922,874,1634,1681,
918,502,1357,1143,1624,1363,2601,2247,2832,2227,
933,743,
1242,1392,2276,2386,2360,2752,760,881,1676,1254,
3144,3329,2438,2222,1415,1337,1474,1566,1358,125
7,494,70
2,2602,2629,3093,3204,8281,8482,8721,8716,8388,8
333,8293,8339,9221,9280,8368,8334,8722,8513,8223
,8392,15
79,1798,921,501,2441,2331,2170,2496,4389,4484,41
87,4680,5185,5140,4865,4294,1199,1147,1682,1636,
1365,180
1,876,847,2401,2609,3107,3330,2251,2111,2388,244
2,992,447,1244,1338,733,827,1448,1419,934,882,169
7,1607,9
37,963,1379,1311,4268,4216,4297,4432,4158,4378,5
376,5154,2575,2630,2604,2229,1207,1258,1149,1581
,747,505,
855,924,1684,1640,1366,1340,4239,4199,4274,4390,
4189,4740,4298,4688,8282,8737,8484,8514,8724,845
5,8341,
8294,8297,8496,8488,8355,8284,8239,8459,8577,234
3,2333,2280,2172,1265,1802,734,829,2253,2230,269
1,2610,1
587,1369,1476,1421,4419,4488,5144,5156,4393,4866
,4203,4276,2334,2633,3098,3585,2347,2402,3152,31
09,965,9
38,1427,1231,1698,1582,1809,1456,4247,4305,4380,
4744,5127,5249,4190,4300,884,506,1381,1211,2259,
2449,223
3,2444,3097,3094,2392,2634,2693,2641,2583,2288,9
225,9222,8738,8516,10248,10256,10272,10243,8400,
8578,83
42,8345,8357,8298,8247,8520,6161,6154,6162,6272,
4394,4496,4704,4448,4421,4629,4251,4306,4401,464
3,4396,4
205,749,945,1260,1688,1648,1611,966,755,2254,214
3,2375,2612,2848,2450,3208,3332,859,940,1804,172
9,1150,1
266,1589,1422,1370,1480,830,911,871,639,1382,142
9,5186,5632,4280,4630,4633,4211,4263,4321,4422,4
402,5131,
5160,4868,4253,4752,4425,1327,1593,1268,1619,240
4,2355,2349,2465,3336,3110,2261,2616,888,479,121
3,1590,
2880,2636,2234,2694,1700,1385,1730,1613,946,750,
1239,1810,1671,1372,1443,1430,2452,2275,2944,264
2,1488,1
704,969,508,2466,2350,3586,3168,2697,2819,2408,2
587,8728,8769,8740,8305,8346,8271,9233,9226,8461
,8300,87
70,8416,8358,8711,8744,8387,6156,6177,6209,6164,
4206,4213,4308,4267,861,757,1825,1386,970,919,16
14,1433,
3139,3113,3216,3100,2159,2379,2262,2357,875,862,
1594,1812,2236,2497,2265,2456,5188,5250,4872,442
6,4322,4
645,4634,4483,1621,1596,758,948,2657,2644,2599,2
698,1243,1335,1732,1622,1625,1675,1445,1816,4404
,4312,51
39,5133,4512,4367,4375,4254,8462,8833,8715,8467,
8772,8483,9234,9344,8251,8361,8752,8306,8469,834
8,8279,8
389,5168,5134,4433,4646,4768,4214,4428,4675,3141
,3114,2277,2207,977,923,1826,1635,972,761,1626,14
34,2468 ,2358,3588,3121,2589,2821,3146,3344,2658,
2705,2381,2167,2648,2387,2266,2416,1255,1712,877
,952,2700,2278,
2439,2361,1677,1272,495,703,1393,1214,1388,1678,
935,978,1683,1359,1504,1339,1245,1394,1637,1446,
1449,147
5,8308,8362,8253,8723,8717,8834,9228,9249,10245,
10304,10249,10246,8473,8470,8718,8369,2498,2590,
3232,35
92,2382,2281,2603,2822,2223,2171,2706,2660,3360,
3600,2389,2825,1638,1567,1259,1436,2268,2362,326
4,3616,4
636,4485,4269,4217,4649,4295,4880,4275,883,762,1
367,1396,2472,2443,2721,2631,4324,4434,4408,4800
,5192,53
77,4486,4270,6400,6178,6168,6180,4650,4677,5141,
5252,503,925,1799,1341,1246,1450,878,735,12288,1
2289,122
90,12292,12296,12304,12320,12291,8485,8580,8283,
8776,9281,9236,8961,8390,3142,3116,2403,2335,147
7,1261,
993,885,2231,2282,3203,3153,1583,1857,1828,1736,
4489,4379,4218,4544,4449,4657,5155,5378,4299,415
9,4436,4
490,4623,4678,4652,4277,8364,8312,8393,8528,8254
,8474,9472,9250,8335,8295,8370,8486,8285,8836,83
94,8784,
2173,2605,2708,2664,939,994,1858,1685,3122,3145,
3087,3392,1832,1803,1641,1628,2390,2364,2289,282
6,2611,2
393,2500,2445,1457,1744,1840,1860,980,926,764,94
1,4391,4381,4328,4220,4301,4278,4739,4658,1371,1
921,1267,
1686,3205,3124,3095,3206,4382,4681,5146,5633,615
1,6273,6210,6656,2451,2255,2722,2606,2833,2480,2
405,223
5,2284,2712,2672,2635,1478,1342,967,886,3456,314
8,2828,2753,1699,1642,831,947,1922,1805,1400,145
2,2174,2

290,2613,2446,1689,1760,507,889,1591,1864,1649,1262,4395,4450,5200,5157,4307,4497,4281,4492,984,751,1383,1481,942,996,1423,1811,3209,3154,2394,2504,2406,2453,3128,3099,5145,5142,4440,4682,4741,4689,4631,4336,4302,4191,4423,4660,4896,4498,5256,5380,1615,1702,1458,1701,3169,3111,2351,2617,8515,8584,9240,9252,8489,8962,8299,8372,8343,8401,8476,8840,9223,9345,8286,8396,2292,2643,2237,2614,1373,1269,1482,1690,4452,4403,4397,4513,6155,6184,6212,6274,1644,1387,971,890,2724,2409,2754,2637,1151,1215,1806,1431,2263,2834,2695,2396,10257,10250,10258,10368,8490,8592,8800,8544,8517,8725,8347,8402,8497,8739,8492,8301,2467,2454,2512,2728,2849,2410,3331,3156,5384,5158,4309,4664,4928,4684,4282,4742,2638,2457,3210,3217,3333,3101,2618,2836,1460,1650,509,949,973,1000,1595,1489,4500,4323,4992,4690,4514,4398,5634,5216,1705,1270,1731,1374,892,950,1623,1692,9282,9728,8376,8726,8729,8307,8359,8417,8518,8498,9227,9256,8964,8349,8848,8521,1814,1484,1273,1706,2645,2620,2267,2359,3115,3170,3587,3160,2756,2646,2649,2699,4745,4867,4456,4635,5187,5161,5264,5148,4207,4427,4310,4405,6163,6157,6192,6158,863,759,1008,510,2469,2840,2850,2659,1597,1435,1827,1813,1733,1389,1464,1652,4284,4545,4313,4504,4705,4692,4647,4746,3212,3102,2650,2458,1713,1398,1447,1490,5189,5162,4325,4255,4516,4406,5636,5169,3218,3143,2279,2736,2701,2296,2417,2238,979,953,1817,1274,1395,1505,1598,1437,2412,2702,2707,2383,3334,3337,2528,2363,6216,6401,6165,6276,4637,4869,5194,5392,4706,4753,4429,4215,4696,4435,4314,4464,2269,2418,3233,3648,763,974,1627,1390,3117,3172,2661,2470,1492,1679,954,879,2473,2499,3712,3123,1924,1829,981,982,4748,4326,4487,4409,6179,6402,6170,6657,10252,10273,10305,10260,8302,8309,8404,8363,9284,9346,8968,8522,8418,8741,8730,8579,2662,2591,2283,2460,2391,2420,3220,3118,1639,1708,1734,1453,2823,2365,2270,2474,8500,8408,9235,9229,8608,8463,8471,8350,9264,9230,8529,8742,8864,8310,8524,8771,4546,4638,5280,5640,4430,4329,4651,4870,1818,1276,927,995,1397,1629,1872,1714,1737,1656,1506,1830,3147,3338,2501,2285,1451,1928,1438,1247,2607,2881,2852,2760,8732,8581,8365,8313,8745,8391,8976,8371,8420,8530,8504,8896,9288,9473,8582,8366,4271,4219,4754,4708,5408,5648,4437,4873,4316,4410,5312,5664,6224,6181,6169,6166,3345,3589,3176,3234,1687,1716,1859,1643,4520,4491,4769,4679,5190,5164,4451,4383,1496,1479,1820,1833,2882,2709,2856,2827,3125,3265,2665,2652,3224,3149,2481,2768,4279,4330,5251,5201,4221,4653,4756,4712,765,956,1738,1745,2864,2884,2395,2945,3236,3840,3340,3346,2291,2710,2502,2366,1861,1740,1888,1834,887,985,1630,1936,1746,1720,1401,1459,2723,2666,3590,3126,2946,2829,2424,2476,3155,3129,2713,2784,10496,10274,10264,10276,8746,8773,9237,9348,12293,12352,12297,12294,12305,12298,12306,12416,997,986,1841,1343,1645,1836,1508,1454,6280,6404,6408,6182,5170,5193,5135,5440,4438,4412,4337,4874,4659,4441,4548,4493,1862,1691,943,891,2615,2888,2673,2286,8585,8475,8314,8640,8545,8753,9251,9474,8395,8255,8532,8586,8719,8774,8748,8373,3593,3184,3207,3150,1512,1263,1402,1483,5253,5172,5143,5254,4499,4303,4770,4654,2407,2505,3361,3266,2447,2835,2639,2726,3157,3348,2482,2725,1646,1651,1461,1404,4881,4528,4453,4283,4332,4760,4720,4683,1842,1485,998,766,2397,2293,2506,2714,2668,2411,2175,2239,2830,2455,3594,3130,6658,6240,6211,6185,5504,5196,4876,4801,1520,1693,511,988,1703,1748,1865,1653,3240,3211,2484,2674,1375,1491,1462,1761,1275,1486,1466,1465,2619,2513,3171,3158,1001,951,1493,1271,2729,2294,2755,2398,8487,8477,8424,8316,8397,8374,8835,8754,8478,8777,9242,9729,10247,10369,10306,10752,4222,4338,4661,4494,5257,5202,4442,4552,4454,4501,5176,5147,6288,6172,6213,6186,1707,1866,1762,1923,3132,3352,2647,2716,2838,2508,3161,3362,1694,1807,1873,1844,8491,8546,9296,9253,8403,8593,8377,8588,9241,9238,8536,8778,8837,8785,8727,8432,8398,8287,8519,8756,8992,8594,9352,9476,8548,8499,8493,8609,10251,10280,10308,10370,2297,2730,2621,2459,2851,2837,2757,2413,3601,3596,3268,3213,1752,1952,1815,1391,5217,5159,4399,4665,4340,4691,4285,4662,4772,4457,4802,4685,4311,4882,4743,4444,6660,6193,6218,6416,4515,4502,4560,4776,4897,4458,5379,5204,4686,4505,5258,5

265,248
8,2676,2737,2422,2471,2514,2841,2298,1002,893,19
25,1654,1709,1868,1657,1735,5381,5149,4666,4884,
7168,716
9,6304,6664,4693,4668,4315,4407,5163,5218,5635,5
208,1277,1715,975,894,3173,3219,3248,3214,1848,1
926,1710,
1764,3602,3393,3103,3272,9480,9254,8405,8760,902
4,8780,8378,8838,8596,8419,9088,8786,8610,8494,9
730,931
2,2419,2529,2622,2461,1874,1399,1468,1494,3162,3
617,3364,3394,2651,2414,2516,2703,6432,6672,6336
,6688,48
04,4694,4697,4747,1507,1439,1509,1929,2948,2853,
2663,2732,8841,8963,8552,8731,9283,9257,9360,924
4,8303,8
523,8406,8501,10259,10253,10288,10254,4517,4888,
4898,4707,5260,5150,4698,4506,3604,3335,2758,247
7,3221,
3174,2842,2300,12300,12321,12353,12308,12544,12
322,12312,12324,8380,8641,8409,8600,8801,8788,87
43,8842,
5266,5191,4327,4784,4749,4344,4465,4286,1009,955
,1819,1497,1658,1768,1876,1984,3177,3376,2421,26
53,1889,
1717,1821,1930,2896,2738,2761,2680,3368,3235,253
0,2854,4460,4750,4755,4431,5382,5385,4576,4411,1
739,183
1,1004,1010,3164,3119,2475,2952,4317,4466,5281,5
696,5165,5220,4709,4518,1498,1660,957,983,3339,3
457,2462,
2271,6214,6188,6275,6225,4521,4547,5760,5171,271
1,2740,3618,3396,2883,2667,3280,3458,2520,2503,2
844,285
7,1718,1278,1741,1599,4710,4639,4331,4508,6194,6
217,6159,6464,3222,3225,3237,3178,1937,1822,958,
987,4439,
4468,5268,5166,4871,4413,4318,4522,9285,9258,842
1,8351,8612,8502,9732,9265,10312,10497,10261,103
72,873
3,8965,9290,9488,2762,2769,2885,2764,2912,2858,2
654,2960,3127,3400,2770,2744,1835,1403,1721,1455
,5195,53
86,4549,4333,6277,6196,6167,6278,4655,4929,4900,
4808,5393,5637,5224,5282,1631,1513,1890,1747,242
5,2483,2
865,2367,1012,999,1510,1932,3608,3649,2669,2860,
1742,1837,1500,1880,3620,3185,2532,2478,1863,174
9,1016,7
67,3226,3151,3341,3180,8802,8849,8525,8311,8792,
8531,8410,8560,8844,8422,8583,8505,10275,10498,1
0266,10
753,4930,4757,4904,4875,5173,5313,4713,4700,2886
,2715,2536,2287,2426,2507,3650,3296,1722,1938,17
76,1892,
1843,1838,1463,1953,3238,3591,3624,3267,2670,267
5,2485,2428,8642,8734,9376,9736,8526,8425,8747,8
966,836
7,8315,8850,8804,9504,9744,8533,8969,5272,5197,4
529,4816,4912,4932,4443,4993,3342,3713,3595,3347
,1514,16
47,1695,1763,5284,5888,5388,5394,4339,4758,4550,
4414,2866,2509,2544,2717,2727,2772,2889,2677,841
2,8506,9
408,9760,10320,10277,10265,10262,8616,8587,8865,
8775,9286,9260,8547,8479,4771,4714,5638,5174,652
8,6220,
6281,6226,4994,4877,4472,4524,6200,6171,6241,618
3,1940,1487,1867,1405,2399,2515,3652,3363,3131,3
241,248
6,2785,3632,3186,2299,2510,8375,8426,9347,9297,8
317,8749,8852,8808,10376,10500,10504,10278,9266,
9289,92
31,9536,989,1003,1521,1954,2490,2489,2517,2295,5
203,5177,4761,4832,4663,4936,4721,4334,6403,6228
,6282,62
89,5641,5232,5255,5198,4455,4553,5409,5314,4495,
4883,4687,4774,12295,12417,12354,12800,12299,12
328,1235
6,12418,8534,8508,8433,8970,8755,8537,8644,8589,
9349,9268,9239,9350,8595,8399,8866,8750,8977,862
4,8549,8
379,8428,8856,8816,8779,1845,1750,1985,1896,3349
,3228,2731,2890,3159,3269,3188,3242,1516,1655,17
53,1724,
5205,5396,4530,4773,4445,4341,4554,4762,4716,445
9,4223,4287,6405,6173,7170,7172,1467,1765,990,10
05,2786,
2947,2718,2831,3133,3603,3597,3714,2897,2868,335
3,3350,2776,2976,3598,3249,1869,1944,1406,1846,1
875,175
4,1522,1904,2839,2415,2949,2678,10754,10336,1030
7,10281,9600,9292,8972,8897,8318,8434,8757,8590,
9353,92
98,8538,8648,8550,8597,9272,9243,10384,10268,103
09,10282,9313,9255,8495,8761,8436,8787,8381,8758
,3365,3
460,2733,2892,2681,2759,3163,3656,4878,4503,5642
,5178,5288,5259,4532,4722,6187,6242,6659,6232,46
67,4561,
5219,5206,1766,1469,1495,1659,3841,3270,3244,319
2,4777,4342,4803,4446,5180,5400,4695,4764,3273,3
408,230
1,2739,3134,3354,2872,2950,959,1011,1956,1711,27
34,2788,2898,2423,2492,2518,2531,2463,3215,3175,
3250,336
6,4886,4556,5209,5410,4345,4778,4669,4507,3165,3
716,3274,3664,1927,1849,1524,1870,4899,4885,4805
,4461,62
84,6174,6290,6215,5649,5644,5316,5261,4536,4724,
4785,4470,12307,12301,12336,12302,12360,12545,1
2309,124
20,8868,8553,8898,8781,8407,8978,8839,8540,1769,
1850,1756,1470,2533,2953,3395,3464,1986,1960,149
9,1877,2
843,2521,3369,3842,6406,6409,6305,6720,6189,6244,6784,6195,4519,4562,4889,4346,5221,5267,5296,5262,1891,1661,1931,1511,2682,2792,2900,3008,5650,5441,5151,5320,4467,4577,4670,4509,10756,10289,10314,10512,8611,8598,8656,8872,8993,8554,9475,9300,8782,8601,9354,9361,3179,3252,2913,2741,1013,895,1719,1770,5210,5665,5412,5442,4699,4462,4564,4751,3223,3281,2845,2954,3356,3720,2763,2855,3166,3276,2522,2684,3370,3472,3680,3424,9477,9245,8762,8980,11264,11265,10400,10760,8789,8764,8411,8503,9259,9314,9731,9304,10528,10768,10432,10784,8900,8790,8793,8843,8613,8984,8994,8803,9356,9246,8794,8602,6292,6190,6219,6410,4996,4901,4711,4780,1852,1777,1878,1881,2742,2302,2765,2623,1528,1823,1279,1988,2961,2846,3397,3605,5652,5383,4806,4525,6417,6661,6248,6306,5269,5222,4890,4348,7176,7184,6197,6337,5225,5424,4469,4701,4944,4786,4809,4728,5416,5283,4578,4902,5212,5167,4523,5000,3227,3282,3377,3619,1933,1743,1501,1939,5387,5505,4510,4319,4759,4788,5666,5444,3372,3181,2859,2427,1662,1772,1006,1014,3256,3606,2745,2479,2655,2537,3609,3187,1968,1893,1515,1723,2914,2771,2534,2956,2766,2861,2524,2904,3239,3297,3398,3378,2887,2773,3844,3229,3728,3401,2746,2962,4931,4715,5328,5506,6296,6221,6308,6912,4568,4551,4892,4905,5270,5273,5285,5226,4810,4817,4933,4812,4960,4906,4702,5008,6412,6418,6662,6198,5175,5448,4818,4792,2800,2916,3182,3189,2867,2862,3284,3243,4473,4531,4913,4415,6227,6201,6665,6256,9362,9287,8423,8880,8845,8440,8561,8382,8556,8846,8851,8527,9478,9481,8672,8507,1778,1882,1502,1992,3848,3402,3298,3621,5656,5697,4717,4908,5668,5233,4580,4526,8413,8562,9377,9792,9261,9316,8805,8614,10310,10284,10371,10321,8617,8643,9856,9267,12323,12546,12314,12801,12368,12325,12313,12310,8806,8735,8427,8604,10290,10313,10255,10560,1407,1934,1839,2000,3610,3459,3380,3288,2487,2977,2538,2671,1894,1941,1017,1018,6279,6222,6433,6338,5274,5199,5389,5228,2719,2787,2964,2511,1751,1517,1897,1725,4934,4763,4584,4335,6229,6420,6666,6202,2891,2429,3488,3343,3351,3230,3409,3622,8535,8564,9364,9262,8967,8509,8414,8618,9291,9482,8645,8429,10373,10292,10263,10374,8751,9025,8996,8904,9489,9733,9320,9378,9026,8853,9000,8971,9269,9409,8809,8796,4474,4555,5698,5344,5286,5639,5672,5315,1955,1780,1884,1523,2545,2978,3744,3190,7200,7171,6312,6283,6243,6230,6204,6424,2869,2774,3009,2920,3404,3651,2540,2679,4718,4723,4533,4476,5390,5761,5643,5395,4914,4557,4592,4765,4775,4820,4937,4725,3612,3461,3245,3193,2777,2748,2491,2789,1755,1847,1946,1898,1942,1526,1957,1767,9368,9293,8625,8912,9008,9028,8539,9089,9380,9984,9484,9490,8435,8854,8646,8510,3625,3271,3856,3251,3300,3410,2893,2968,6233,6434,6673,6668,6340,6285,6245,6291,8867,8810,9734,9270,10624,10316,10377,10322,12424,12548,12552,12326,12802,12384,12355,12329,4447,4563,5700,5411,5179,5289,4534,4833,5680,5234,4347,4558,4538,4537,4565,4343,5397,5276,4779,4938,5207,5317,5236,5290,3384,3776,2430,2870,991,1020,1784,1905,7173,7232,6320,6286,4834,4995,4766,4879,3462,3246,2899,2778,1518,1726,1945,1525,3626,3653,3465,3355,2546,2928,3194,3520,5181,5651,5645,5762,4945,4916,5401,5398,2790,2493,2519,2683,1900,1871,2016,1471,2980,2735,3425,3633,2951,2873,3275,3135,9090,8973,8568,8620,10296,10267,10337,10279,9299,9273,8857,8928,8759,9032,8817,8430,1757,1851,1958,1906,3412,3466,2548,2894,1961,1987,1771,1529,2793,2874,3599,3654,6674,6465,6175,6344,4824,5024,5646,5297,4887,4463,4997,4726,6234,6689,6436,6466,10499,10324,10378,10385,9737,9328,9351,9294,8551,8649,9505,9410,8591,8979,8783,8870,9301,9492,8626,8869,8541,8437,8650,8858,8812,8555,8319,8383,10501,10269,11266,11268,3628,3253,3367,3357,2780,2494,3304,3196,6676,6407,6293,6246,5413,5508,4781,4940,4729,4807,5211,5704,5889,5318,5292,5240,3277,3254,3715,3634,3010,2984,2523,2901,8974,8599,9738,9274,9384,9355,8628,8818,12432,12316,12357,12330,12804,12337,12362,12560,2915,2685,3358,3657,1879,1948,1758,1853,5321,5456,4349,4787,5182,5402,4920,4998,3371,3426,3283,3473,2955,2535,2743,2794,4782,4836,4946,4471,4540,4566,4579,4511,5263,5223,5298,5414,5213,5764,5322,5712,4581,5001,5443,5512,6249,6448,6440,6307,10283,10338,10755,10328,8763,8657,9 315,9302,8873,8438,8899,8542,9276,9496,8791,8860,4891,4569,5417,5890,6236,6191,6411,6529,7177,7174,6690,6468,4730,4840,4948,5056,2876,2801,3257,3468,1989,1962,1908,1530,1773,1969,1990,1779,3416,3658,2902,2905,8982,8652,9305,9506,8441,8874,8765,8603,8995,8981,8901,8557,10380,10270,10386,10311,3717,3665,3607,3312,3278,3167,2552,2847,1883,1964,1854,1935,2303,3012,3399,3636,3872,3474,3428,3379,2957,2767,2525,2963,5227,5300,4961,4789,5271,5329,4893,5002,6352,6530,6294,6297,6309,6250,6199,6472,5404,5768,4811,4903,5214,5324,4570,4732,9745,9740,9412,9357,8632,8820,8881,8566,10502,10505,10401,10816,10285,10340,10880,10291,8615,8658,8985,8442,9317,9363,9392,9358,13312,13313,12448,12808,12576,12816,12480,12832,1895,1663,1912,1503,1970,1774,1993,1532,5418,5520,5728,5472,4790,4350,4813,4671,3373,3489,2686,2796,2992,2917,3285,3640,2539,2747,3904,3660,2802,2906,3258,3718,9746,9537,9247,9416,8563,8673,8766,8605,9306,9761,9508,9538,8795,8558,8660,8847,6680,6721,6692,6257,5009,4894,5445,5653,3476,3299,2526,3016,3968,3666,3490,3374,10388,10286,10315,10506,9092,8997,8807,8876,9748,9479,8902,8621,10513,10757,10344,10402,6298,6223,7185,7178,5275,5330,5425,5667,5420,5229,4907,4475,5304,5654,4793,4527,1885,1781,1994,1943,3721,3843,2431,2958,3432,3611,3183,3403,2863,3024,2918,2965,4703,4585,5657,5235,4962,4819,4582,5004,6413,6252,6722,6368,4814,4909,4572,4952,12358,12332,12419,12369,12338,12361,12303,12608,9365,9318,8986,8444,11272,11280,10293,10433,9321,9520,8565,8797,9040,8882,8905,8824,9512,9379,8674,8998,9308,9263,8619,9096,5287,5345,5446,5426,6310,6663,6696,6339,1899,1886,1782,1972,2775,2541,3286,3381,6414,6785,6667,6419,4935,4821,5892,5277,2921,2749,3260,3521,2001,1947,1996,1785,5776,5449,4794,5010,6724,6435,7186,7296,3289,3480,2979,2804,1901,1976,1519,1727,9483,9601,8606,8415,8855,8884,9762,9540,12421,12340,12311,12422,12672,12364,12425,12370,4848,4964,5230,5237,4915,4910,5332,5291,5896,5450,5346,5669,6203,6313,6704,6258,3681,3668,3623,3722,2908,2547,3301,3231,5658,5507,5428,5336,4535,5025,4586,4719,9027,8811,9424,9602,10392,10317,10404,11008,8664,8647,8988,9001,9366,9369,9381,9322,3492,3382,3613,3845,1959,2002,1007,1015,2779,2871,2970,2922,3682,3729,2966,2550,3405,3191,3672,3411,2981,2791,3290,3440,6421,6300,6231,6341,4767,4835,5012,4559,2808,2929,3724,3302,3463,3385,3522,3614,4939,4477,5536,5391,5399,5278,5457,5670,8906,8913,9029,8908,9056,9002,8798,9104,10508,10514,10758,10294,9271,9544,8914,8888,8569,8627,9009,8511,10323,10297,10761,10352,12344,12315,12385,12327,12547,12372,12426,12433,6260,6314,6205,6675,6669,6786,7180,7201,3406,3305,2542,2750,3627,3846,2969,2549,9752,9793,8813,9004,9764,9329,8676,8622,10375,10318,10529,10434,9370,9295,9485,9324,3247,3195,3730,3684,3413,3849,2924,2895,4593,5026,5792,5238,4917,4822,5057,4968,6425,6422,6670,6321,5452,5699,4588,4727,6437,6532,6235,6728,5660,5509,5293,5241,9030,8859,8680,8431,10325,10516,10762,10298,8570,8651,9794,9440,9382,9735,9768,9411,1907,1786,1527,1949,3040,2495,3292,3386,4825,4796,4539,4837,5673,5319,5904,5299,7233,7188,6913,6342,6316,6264,6345,6480,5348,5458,4941,5016,5432,5824,4478,4918,2781,2875,3496,3467,2982,2930,3745,3655,1902,1759,2017,1909,2985,3011,3427,3359,3255,3306,3197,3629,2795,2553,2903,2972,5510,5294,4947,4826,6206,6426,7424,7202,5674,5701,5513,5403,4594,4976,5242,5568,6287,6247,6322,6438,4838,4541,4567,4731,1963,2018,2004,1950,3732,3688,3414,3388,3313,3850,2782,2877,3635,3417,3524,3469,12549,12317,13314,13316,12331,12386,12803,12376,11296,11267,10408,10379,10339,10326,10300,10520,8814,8819,8629,8572,9486,9857,9739,9491,9010,8653,8688,8861,8871,8916,9033,8821,3013,2986,3475,3279,1788,1965,1991,1910,5028,4783,5473,5681,4999,4921,5323,5183,6237,6788,6346,6736,6467,6536,7192,7204,3746,3630,3857,3504,2932,2554,3429,3259,10329,10530,10769,10764,10436,10381,10341,10387,8543,8659,9796,9507,9275,9385,8630,8929,5460,5514,4596,4942,6441,6914,6251,6324,4841,4922,5647,5702,5676,5301,5415,5405,6295,6353,6428,6792,4828,4542,5352,5244,2797,2993,3308,3736,3696,3659,3014,2803,9776,9330,8443,8654,8634,8633,8661,84

39,9493,9372,8875,9034,9303,9413,9332,9386,2907,2988,3852,3777,1855,1971,1531,1913,5325,5302,5763,5682,5058,5032,4571,4949,4963,4733,5406,5705,5419,5474,5331,5521,5003,4583,4791,4842,7175,7297,6238,6348,12428,12318,12434,12359,12550,12553,12449,12864,11269,11328,10416,10382,8930,9091,8862,8975,3198,3314,3637,3470,2008,1775,1966,2020,3418,3528,2878,2959,2919,2687,3430,3477,6442,6544,6752,6496,4924,4849,5305,5516,3375,3641,3316,3667,2936,2527,3261,3638,3748,3433,3778,3661,2994,2798,3287,3858,5464,5706,4950,4953,6469,6677,6299,6354,1995,1914,1533,1973,3719,3420,3491,3478,5765,5713,5655,5360,5326,5215,4600,4895,9277,9747,9741,9858,9041,9012,9497,9494,10770,10561,10271,10440,8920,9120,9742,9393,8983,8559,9093,8822,10330,10785,10532,10562,12333,12388,12928,12339,12436,12334,12363,12554,3536,3752,3017,2556,2909,2805,3873,3434,6449,6691,6444,6253,4351,5060,5447,5684,5920,5522,5476,5427,7234,7680,6328,6678,3018,2967,3662,3481,2923,2910,3642,3860,5005,4815,4573,5011,5421,5537,4734,4844,5040,4965,5333,5688,4587,4795,5952,5708,6681,6259,6311,6369,6470,6450,7179,7208,3669,3644,2806,2996,3291,3383,3780,3670,10772,10503,10389,10342,9509,9604,8877,9036,8825,8903,9307,9800,9985,9414,9388,9336,9417,9552,8445,8883,9278,9498,9016,9094,8878,8932,9042,8567,8636,8662,8675,8607,12561,12805,12392,12450,13320,13328,12341,12481,9359,9319,9394,9510,9309,9860,9418,9808,8677,9097,9539,9608,10345,10544,10536,10403,8987,8665,9513,9986,10332,10287,10507,10625,4850,4954,5306,5766,5524,5347,4574,5064,6016,5714,5538,5422,5769,5891,4479,5006,1997,2024,1916,1974,3673,3723,3493,3864,3025,2971,3874,3683,3020,2809,3674,3482,11273,11270,10786,10564,8826,8936,9044,9152,14336, 14337,14338,14340,12440,12365,12452,13056,9323,9396,9057,8885,9367,9425,8989,9098,10448, 10626, 10390, 10393,10405,10346,10295,10568,3303,3760,2925,3000,1887,1783,2032,1534,6916,6301,6800,6473,6254,6261,6356,6315,3725,3320,2543,2751,3441,3262,3436,3726,7236,7298,6920,6474,6370,6693,6682,6531,5480,5659,5231,5451,4911,5072,4966,5013,2983,3026,3731,3407,3552,3387,3293,3442,6452,6360,7187,7181,6560,6415,6423,6302,4823,4589,5334,5429,4969,4797,5308,5569,12556,12562,12806,12342,12371,12345,12809,12400,9500,9864,8907,8999,9310,9420,8666,8828,3685,3494,3497,3523,3686,3615,3307,3484,5337,5528,5027,4852,5729,5716,5671,5770,9514,9616,9824,9568,8886,8446,8909,8767,10776,10817,10788,10353,9105,8990,9541,9749,7216,7182,6481,6694,4956,4595,5349,5279,6816,6262,6476,6723,5540,5430,5661,5893,10394,10319,11281,11274,9371,9426,9521,9763,9516,9325,9003,8571,9400,9750,8889,8623,2003,1977,1019,1021,2931,2810,3415,3444,2551,2973,3847,3389,3294,3498,2926,2783,6684,6533,6317,6265,4827,4919,5018,4970,3525,3309,3041,2933,3631,3905,3876,3784,5730,5777,5014,4598,5453,5239,5720,5459,6697,6343,6928,6323,5029,4839,5338,5488,8799,8681,9753,9331,9058,8915,8678,9100,10509,10348,10818,10464,8910,9005,8668,9048,2987,3042,3906,3733,1787,1998,1978,1903,6372,6482,6456,6848,4856,4977,5772,5350,9383,9441,9542,9522,10406,10759,10792,10435,10510,10881,10763,10515,9031,8917,9988,9373,3880,3851,3689,3676,2005,2006,1951,2019,7240,7425,6534,6318,5511,5433,5570,5662,12423,12366,12577,12482,12373,12564,12810,12346,9872,9545,8890,9106,10820,10531,11282,11392,5454,5353,4590,4798,6698,6725,7189,7300,5675,5894,5017,4597,6537,6427,6266,6592,5295,5243,5778,5732,5461,5897,4972,4943,3505,3792,3888,3908,3028,2974,2812,2989,8944,9060,9326,9333,9011,9006,9428,9387,13344,13315,12456,12427,12387,12374,12348,12568,6497,6705,7203,7426,6347,6207,6484,6538,3419,3969,3315,3734,1789,1980,1911,2009,9992,9546,9442,9765,10299,10409,10800,10354,9754,9603,9524,9432,8631,9121,8682,8815,5088,4543,5340,5434,4829,4923,5544,5515,5030,4978,5793,5703,5033,5059,5475,5407,6671,6726,6700,6325,5303,5354,5245,5677,3526,3390,3015,2934,3747,3690,2879,2995,10517,10396,10327,10437,8863,8931,9108,8655,12377,12578,12817,12812,12484,12429,12389,12435,9035,8573,9632,9487,9495,9374,9553,9766,10356,10410,10301,10771,10765,10882,11276,11297,3970,3853,3448,3500,3737,3808,2555,2937,4843,4601,4951,5020,5780,5736,5462,5436,2021,2010,19
67,1915,3639,3912,3697,3310,6439,6429,6376,6268,
5361,5898,4830,4925,3032,2799,3431,3529,2990,304
4,3471,3
859,6349,6326,6787,6706,5683,5465,5572,5517,3663
,3750,3506,3749,2022,1790,1535,2012,6430,6729,71
94,7681,
6443,6498,7248,7205,8689,9122,9888,9334,9013,891
8,9153,9064,10521,10518,10766,10417,9548,9795,86
84,8823,
5061,5034,5523,5327,5794,5678,5905,5552,4980,460
2,5477,5307,6355,6545,6329,6540,3421,3317,3530,3
738,369
2,3435,3019,2938,3199,3263,3854,3479,3508,3698,2
557,2997,7193,7190,6488,6730,6789,6737,6679,6384
,4845,50
41,5356,5784,5744,5707,5062,4851,10533,10628,103
31,10824,9756,9605,9389,9337,8921,8892,8635,8933
,9769,9
415,10000,9395,6350,6239,6471,6708,6944,6546,730
4,7428,3021,3048,3643,3537,3753,3318,3779,3422,1
1329,11
284,11009,10438,10412,10360,10441,10576,9444,95
54,9037,9112,9528,9920,8574,9014,4955,5036,5900,
5825,524
6,5362,5685,5518,5466,5576,4926,5007,4967,4735,5
478,5525,9606,9390,9043,8922,10302,10522,11520,1
1298,13
317,13376,12464,12430,12818,12609,12319,12488,9
770,9797,9609,9499,8690,9072,9338,9664,12378,128
33,1258
0,12610,12820,12551,12437,12390,2940,2998,3671,3
740,3862,3532,3321,3754,5423,5689,5364,5715,6500
,6451,6
445,6561,7432,7206,6357,6712,4984,4575,5309,5686
,6976,6732,6330,6790,5796,5481,5826,5709,2025,19
75,1022,
1023,2911,2807,3056,2558,5042,4846,5335,5906,576
7,5468,5539,5526,10383,10343,10418,10534,8934,86
37,8663,
8827,9124,8879,9569,9777,9095,9017,9419,9279,123
93,12592,12584,12451,12380,12335,12555,12673,10
333,108
84,10442,10832,10563,10632,11288,11300,9556,961
0,8692,9038,10537,11010,10347,10420,8937,9018,97
43,9798,
9772,9397,9511,9501,3645,3483,3875,3861,3781,343
7,3512,3700,6548,6371,7040,6738,5584,5800,5065,4
604,656
2,6446,7682,7264,6793,6915,6504,6683,3761,3446,3
495,3538,3027,3001,3865,3322,10391,10449,10524,1
0888,89
24,8638,9448,9340,9421,9398,9859,9778,9154,9128,
8667,9045,9059,8829,9502,9801,9515,9570,9427,961
7,13321,
13318,12834,12612,14344,14352,14368,14339,3443,
3553,3646,3485,2026,1917,1999,1918,4957,4853,592
1,5482,5
066,5015,5710,5529,7235,7209,7312,7196,6255,6475
,6358,6453,4971,4958,5690,5908,6332,6593,6361,65
52,5717,
5692,4854,5044,6753,6740,6695,6794,2811,3022,367
5,3438,3540,3727,3002,2927,3972,3877,3029,3030,3
687,375
6,3782,3501,5339,5431,5828,5718,5721,5771,5541,5
912,7237,7210,6373,6303,5073,5019,5922,5731,5068
,4857,57
22,5530,6564,6454,7684,7217,9099,8679,8887,8938,
11271,11393,10334,10444,10538,10640,10848,10592
,9020,89
45,9401,9612,12496,12674,12438,12441,12453,1239
4,12343,12616,9560,9802,9046,9049,10565,10773,10
395,104
50,3866,3324,2975,3043,3445,3677,3920,3762,6685,
6917,7242,7440,6754,6801,6477,6263,9861,9809,975
1,9456,9
422,9311,8696,8991,10545,10787,10540,10349,8447,
9156,9543,9780,6744,6483,6362,6512,5351,5808,497
3,5048,
6796,6374,6535,6457,5773,5368,4591,4799,2033,197
9,2028,2034,3785,3704,3554,3878,5489,5310,5484,5
774,503
1,5074,5779,5455,5600,5435,5341,5490,5733,5542,5
545,5571,6594,6686,7328,7688,6478,6377,6699,6918
,10016,9
618,9572,9523,11330,11776,10424,10774,9101,8911,
8669,9107,9517,9633,8830,8940,6319,6267,6802,675
6,7456,
7696,6485,6921,3499,3976,3486,3295,3735,3764,390
7,3691,9136,9061,9429,9784,8683,8891,10048,9804,
12824,1
2865,12836,12401,12442,12367,13329,13322,10777,
10355,10407,10465,10566,10546,11275,11304,8946,
9050,940
2,9862,9620,9443,8670,9160,3544,3527,3868,3881,2
813,3004,3786,3793,5734,5663,5355,5532,6364,6458
,7360,77
12,3909,3788,3936,3882,2935,3033,3678,3984,4979,
4858,5463,5492,6568,6539,6817,6727,12557,12396,1
2866,12
512,12454,12807,12840,12483,12558,12929,12811,1
2563,12868,12579,13330,13440,10112,9810,9634,95
18,9865,
9987,8575,9102,11012,10397,10896,10569,10350,10
357,10452,10411,3794,3768,3449,3507,3045,3034,38
89,3391,
4599,5021,5895,5437,5342,5546,4974,4831,11332,11
394,11016,10570,10466,10789,10778,10627,9576,97
55,9327,
9547,9007,9168,9062,9109,7238,7212,6499,6431,557
3,5357,5089,4981,1981,2007,1982,2011,3693,3884,3
556,350
2,10548,10456,11283,11277,10656,10511,10519,103
98,8919,8685,9430,9525,9065,8893,9404,9665,6327,
6378,729
9,7249,5679,5953,5924,5832,6269,6701,6804,6760,5

035,5090,5954,5781,7218,7241,7183,7488,5928,5899,5737,5724,6486,6460,6385,6922,6707,6489,6596,6541,12347,12457,12848,12402,12565,12444,12375,12485,9433,9624,9123,8948,9825,9812,9767,9866,3910,3739,2991,2939,3560,3311,3450,3531,5553,5840,5936,5956,5076,5022,4860,5037,3694,3699,3509,3452,3890,3533,3046,2814,5467,6017,5363,5782,7301,7220,7191,7302,11312,11278,10577,10790,9052,8691,9445,9375,12404,12458,12349,12819,12813,12930,13324,13345,10912,10358,10572,10819,9636,9526,9757,9989,14341,14400,14345,14342,12569,12566,12814,12465,10780,10629,10413,10361,8923,9015,9114,9066,9826,9873,9110,8694,9549,9335,9816,9555,10793,10439,11024,10419,9125,8935,9434,9584,10468,10578,10552,10944,8952,9073,9868,9446,6547,6351,6818,6702,6929,6576,6501,6331,3568,3741,2559,3036,3751,3796,3913,3701,11336,11521,10630,10414,9607,9529,9666,9758,9550,9449,8686,8894,10794,10821,11285,11396,6380,6808,6768,6731,5574,5438,5063,4982,3423,3539,3510,3809,2036,2023,2040,1791,7552,7244,6924,6849,5795,5738,4927,5043,6018,5901,5496,5548,6270,6386,6709,6542,3323,3534,3514,3513,3049,2999,3541,3319,5785,5856,4603,4985,5687,5960,5745,5358,5080,4847,5479,5577,5038,5092,5519,5907,7305,7250,6490,6600,6502,6549,7224,7195,5711,5798,5554,5797,7265,7207,6447,6713,6388,6739,6333,6710,5469,5365,5578,5786,9771,9990,9113,8693,10633,10523,10362,10688,12581,12676,12379,12872,13377,13332,13057,12486,9391,9339,9874,9828,9557,9993,9068,9039,10593,10801,11299,11522,10443,10303,10580,10634,9184,8639,9436,9530,8925,9019,9640,9611,9126,9074,9889,9799,9129,9155,9571,9503,12460,12408,12489,12624,12350,12570,13568,13346,10767,10822,10796,10421,9399,9450,9341,9773,5740,5483,5067,4986,6820,6505,6850,6733,5247,5311,5902,5527,6359,6930,6791,6492,8939,8697,9047,9116,9876,9832,9558,9532,12431,12391,12466,12582,12381,12932,12490,12880,3755,3914,3810,3971,3742,3855,3921,3892,6563,6550,6608,6824,6945,6506,7427,7252,10535,10525,10472,10364,9457,9994,8926,9021,10445,10422,10883,10802,9779,9561,9668,9613,3800,4000,3863,3439,3050,2941,3973,3702,6734,6553,7306,7313,7429,7197,6714,6932,5556,5746,4605,5045,5069,5096,5691,5585,3757,3916,3705,3783,2013,2027,2014,2029,12611,12680,13336,13348,12585,13058,12395,12468,10526,10825,11290,11777,10539,10594,11344,11301,5801,5366,5827,5470,4988,5046,5719,5788,3325,3763,3023,2942,3896,3974,3758,3812,9157,9130,9619,9423,9890,9774,10001,9648,12439,12497,12572,12936,13319,13441,12382,12492,5910,5580,5369,5802,6741,6716,6363,6455,72 11,7266,7683,7256,6852,67 42,6745,6795,9076,8698,9573,9403,10451,10641,10425,10636, 11289, 11286, 10584, 10826,10885,10833,10775,10480,3922,3447,3516,3542,3555,3487,3557,3977,4959,4855,5104,4606,6565,6936,6946,6755,14353,14346,14354,14464,12586,12688,12896,12640,12613,12821,12443,12498,12593,12835,12588,12397,5693,5531,5923,5909,5829,5485,5560,5748,7308,7198,6746,6554,5809,5494,5543,5586,8941,9137,9452,9880,9840,9803,9158,8947,10446,10335,10567,10804,11040,10642,11400,11524,9051,9132,9996,9921,9342,9458,9781,9614,9562,9672,9022,9103,9063,8831,9574,9621,7314,7239,6375,6832,6797,6392,6513,6334,5075,5049,5913,5370,5491,5601,5694,5533,3057,3003,3867,3545,3706,3816,3924,4032,3937,3765,3869,3978,3787,3879,3052,3058,6508,6798,6803,6479,7430,7433,6624,6459,6365,6514,7329,7744,4859,5070,5723,5486,13378,13824,12472,12822,12825,12403,12455,12513,12614,12594,13323,13352,13060,12445,12944,12617,9519,9785,9460,9811,10596,10547,10541,10657,11528,11302,10453,10808,9080,8671,9405,9782,11072,10828,10426,10886,9892,9577,9922,9805,9138,8942,9431,10002,9863,9564,9635,9622,10644,10467,11136, 10834,9680,9896,9161,8700, 10658, 10542, 11778, 11360, 10889,11011,10600,10779,7213,7268,6757,6566,5588,5775,5050,4975,1983,2035,2037,1919,3546,3708,3005,3031,14348,14369,14401,14356,12398,12405,12500,12459,9053,8949,10017,9578,9162,9111,9806,9625,6569,6595,7808,7219,6020,5925,5077,5078,3766,3326,3789,3647,3985,3870,3006,3035,6758,6687,6379,6556,6487,6516,7316,7214,5735,5804,5830,5549,6919,6461,6366,6570,11331,11305,11408,11292,10351,10571,10454,10549,9067,9054,9786,10004,10428,10689,10457,10648,5914,5372,5023,5

091,5493,5725,5968,5810,3883,3451,3769,3503,3679,3561,3938,3795,5833,5752,5602,5926,7243,7434,6597,6381,5547,6024,5534,5343,6703,6977,6948,6856,3060,3047,3558,3980,3790,3885,3548,3928,7441,7685,7272,7330,5783,5812,5955,5739,3911,3797,3064,2815,3770,3986,3824,3940,5592,5575,5916,5929,6978,6805,6952,6923,13380,13442,13064,12618,12514,12837,12826,12675,9813,9788,8950,9140,10849,10836,10791,10890,9435,9527,9924,9814,9817,9867,9637,10008,12596,12504,13331,13325,12704,12559,12567,12446,7221,7361,6761,6748,7320,7245,6577,6864,4861,5052,5834,5841,6960,6980,6491,7041,13360,13326,12625,12838,12960,12406,12620,12867,11333,11306,10469,10399,9169,9115,10018,9827,9164,8953,9818,9626,10660,10550,11780,11313,10781,11013,11338,11536,10850,10897,10573,10359,7332,7936,7436,7442,6387,6806,6598,6462,5957,5836,5984,5930,4983,5081,5726,6032,5842,5816,5497,5555,6819,6762,7686,7222,3891,3886,3511,4001,3562,3695,3743,3811,10840,10579,10458,10608,9447,9904,9069,9144,10892,10470,10631,10553,9869,9464,8687,8895,7042,6925,6520,6572,7251,7225,6809,6880,5093,5082,5937,5439,5741,5932,5604,5550,9585,9406,9580,9870,9127,9170,9875,9551,9696,9531,9437,9586,9829,9638,9641,9667,10690,10782,11424,11784,10574,10473,10795,11014,10415,10363,10898,10852,11552,11792,10581,11017,9830,9759,9451,9628,10460,10554,11456,11808,12828,12677,12461,12409,12841,12487,13072,12467,9075,8954,9559,9588,10664,10635,10913,10823,12516,12626,12600,12992,13384,13569,12678,12462,14592,14370,14360,14372,12842,12869,13333,13444,8695,9117,9991,9533,9438,9642,9070,8927,5958,5787,5039,4987,6711,6984,6769,6382,3988,3535,3915,3453,3037,3051,3569,4002,3893,3798,4033,3944,3564,3703,3801,3772,7689,7280,7303,7246,5608,5359,5498,5579,6503,6601,7457,7362,6543,6931,6735,6822,7253,7444,6578,6821,5742,5747,5557,5500,3515,3813,3038,3053,3917,3992,3454,3894,5938,5581,5094,4862,6493,6389,6602,6810,6764,6507,6271,6335,6926,6551,7690,7226,5616,5789,4607,5084,5799,5844,5961,5749,11334,11308,10595,10527,9669,9453,9185,9077,10423,10474,11395,11345,9775,10049,10020,9928,12681,12571,12410,12736,12641,12849,13347,13570,12491,12351,12628,12682,12815,12870,12844,12469,10365,10797,10900,10856,9131,9186,10050,9877,11314,11337,11279,11584,10024,9995,9833,9820,3923,3802,3570,3952,3814,3517,3543,3707,3007,3059,4004,3759,3975,3897,3572,3918,10582,10556,10481,11018,10803,10585,10692,10637,9649,9936,10032,10052,9172,9118,8956,9133,7336,7307,6580,6770,5471,5587,5558,5857,5371,5582,5562,5561,6715,6609,7267,7254,5097,5047,5589,5367,6825,6390,6851,6494,5803,5962,5858,6019,7228,7448,6743,6812,12583,12573,12520,12412,12493,12470,12931,12850,9563,10113,9459,9878,11397,11316,11287,11398,6934,6604,7257,7458,5790,5903,5969,5940,6393,6826,6717,6555,6947,6933,6853,6509,12574,12873,13338,13825,14343,14465,14402,14848,10643,10447,10914,10798,11025,10672,10597,10427,10476,10904,10864,10827,9670,9534,9159,9078,11648,11340,11020,10945,9891,9834,9023,9139,3817,3898,3804,3518,4034,4008,3547,3925,7697,7692,7364,7309,5848,6048,5911,5487,6584,6772,6833,6518,6567,6610,6937,6394,5098,4989,6021,5750,5805,5964,5753,5831,10114,9997,9592,9644,10366,10482,10805,10638,9881,9952,8699,9081,9783,10056,9841,9454,12587,12642,13392,13349,12499,12689,12473,12684,9176,8943,9575,9673,9134,9188,9615,10003,11401,11346,10586,10696,10598,10645,11320,11291,13337,13334,12632,12874,12933,12881,12823,12528,3939,3709,3979,3559,3061,2943,3767,3818,5373,5811,5071,4990,7269,7315,7344,7310,12494,12383,12615,12852,13088,12690,13448,13572,9807,9894,9650,9893,11361,11303,10543,10809,5944,6022,5806,5860,7698,7489,7199,7368,3900,3825,3926,3929,3576,3871,3327,4036,10484,10835,10429,10806,9565,9461,9674,9882,12644,12595,12589,12705,14347,14376,14404,14466,6515,6625,6718,6557,5970,5495,5564,5590,3981,3791,3549,3987,3710,3820,3054,3062,9836,9579,9163,9082,10916,10601,10946,10829,9343,9407,9998,9623,10455,11026,10887,10588,10659,10646,10704,10920,11041,10602,11523,11348,13576,13350,12501,12856,13120,12876,12474,12934,7258,7713,7460,7490,6747,6510,6612,6 799,5603,5535,5605,6025,7044,6949,6759,6828,10830,10649,11402,11409,11525,11293,10810,11028,9652,9842,8701,9141,9165,9192,9787,9681,7700,7431,6854,6573,7317,7270,6938,6396,4016,3941,3563,3771,2030,2038,2041,2042,5105,5051,5915,5593,5754,5864,5972,6080,7273,7472,6517,6749,5985,5813,5917,6026,6992,6834,6857,6776,7464,7331,6626,6950,5835,5927,5100,5106,7260,7215,6571,7048,12692,12515,13184,12882,12706,12590,13826,13408,9897,9462,9923,9566,9084,9142,9815,9884,5594,5756,5053,5079,7435,7553,6558,6367,6807,6836,7714,7492,6979,6763,7376,7554,10006,9676,9465,9898,10837,10812,10459,10551,11307,11362,11779,11352,10948,10838,10841,10891,12937,13059,12648,12827,13379,13353,13456,13340,12399,12619,12502,12597,14355,14349,14384,14350,6616,6599,6940,6953,5814,5374,5837,5695,7318,7321,7333,7274,6033,5918,5054,5083,6858,6865,6981,6860,7008,6954,6750,7056,7223,7496,6866,6840,5931,5499,5817,5551,9055,8951,9200,8702,10661,11032,11042,10851,9789,9627,10019,10005,9925,9581,9656,9844,12476,12737,12505,12696,12897,12884,12839,12938,11404,11294,10842,10650,9905,9590,9639,9682,13381,13354,12517,12447,12708,12598,13828,13361,11410,11335,10471,10928,10893,10488,10609,10430,3826,3930,3550,4040,3455,3982,3887,4048,5727,5609,5986,5843,6521,6579,6961,6463,9171,9145,10009,9466,9587,9697,9790,9629,10604,10894,10899,10575,11526,11529,10720,10555,14408,14593,14357,14468,12829,13061,13386,13584,12898,12945,12621,12407,12888,12627,12506,12656,10461,10610,11425,11840,8955,9166,9819,9582,11309,11364,10853,10662,9684,9871,9146,9071,5108,5095,5606,6028,7704,7745,6765,6956,5838,5933,5596,5976,7716,7281,6628,6574,3942,3989,3065,3066,3799,3565,3945,3773,5959,5845,5112,4863,7322,7247,7437,7276,6982,6811,6632,6383,6522,6603,7746,7392,5818,6034,5872,5988,5939,5934,5559,6049,10665,10691,11904,11315,10116,10021,9173,9174,12940,12518,12679,12601,14371,14594,14362,14849,10854,10783,10475,10652,10583,10612,11412,11310,9831,9900,9926,9645,11015,10557,10462,10666,12738,12830,13472,13832,12622,12521,12843,13062,10010,9468,9119,9187,9589,9821,10064,9906,4003,3828,3932,3571,3803,3895,3994,3946,7334,7687,7720,7363,6766,6771,6581,6524,7438,7809,7691,7443,5610,5743,5791,5859,6962,6605,6640,6813,6823,6868,6985,6773,6036,5583,5963,5501,6495,6611,7748,7459,3990,3574,4005,3815,3039,3068,3832,3953,9929,9848,9698,10022,11339,11530,10693,10477,9643,10120,9630,9439,10799,11073,11044,10952,12463,12411,12946,12900,13600,13840,12629,13065,12508,12602,13504,13856,14416,14373,14361,14358,7227,7337,6582,6881,7728,7282,6395,6606,5085,5099,5617,6050,6586,6585,6613,6391,11537,11781,11368,11426,9879,9908,10051,9835,12712,12683,12961,12871,13382,13356,12643,12575,9688,9671,10012,10025,11074,10901,11048,11019,11317,11457,10857,10844,11416,11341,10673,10960,12471,12522,13443,13393,12413,12845,12948,12904,8957,9148,9930,9937,11056,11076,10587,11137,5941,5846,6081,5992,7445,7324,6827,6986,7255,7365,7284,7338,5612,5751,5849,5820,5563,5861,5086,5101,6882,7043,6814,6927,3566,3774,3993,3573,3948,3919,4064,3519,11428,12032,11532,11538,10483,10902,10694,10558,10053,9932,10080,10026,9079,9177,9822,10128,9938,9912,9593,9651,10915,10858,11782,11318,11138,11021,10616,10668,11347,11321,10905,10976,9189,9178,10033,9535,9837,10028,9700,9646,14472,14596,14600,14374,13362,13385,13327,13632,7229,7699,7693,7810,6993,6964,7449,7446,3805,3899,4006,3954,4009,4035,3819,3577,6872,7072,7694,7345,5965,6040,5502,5942,5971,5850,5618,6000,6935,6511,7045,6774,12630,12604,12529,13066,12851,12633,12740,12685,10054,9883,9135,9083,10807,11080,10865,10478,7461,7556,6829,6988,6777,6855,7259,7752,5862,5565,5591,5755,7937,7366,7340,7288,7369,7504,6397,6835,7230,7450,6968,7046,5055,5107,6052,5807,6830,6884,6994,6519,11785,11376,11399,11342,9704,9455,9594,9675,13445,13364,13335,13446,12691,12495,12962,12846,3927,3996,3806,3901,4037,4010,3956,3578,6588,6614,6627,6559,7311,7271,7346,7462,10599,10697,11553,11458,10639,11027,10831,10918,11349,11540,10674,10917,9838,9843,9653,9596,7261,7812,7370,7760,6023,5945,5620,5966,5865,5946,5852,5566,6629,7049,7491,75

60,13073,12720,12645,12475,12524,12952,12912,12875,10034,9677,9190,8958,10589,10485,10698,10906,10860,10603,10367,10431,11022,10647,11786,11322,14850,14432,14403,14377,13696,13388,13068,12993,6082,6056,5595,5973,6939,6617,7465,7938,5987,5757,6027,5607,6778,6888,6996,7104,9712,9885,8703,9180,9895,9940,10057,9845,11432,11403,10676,10866,9567,9683,9654,9953,9467,9678,9658,9657,10811,10705,11363,11350,9193,9143,9685,9463,10921,10486,10947,10590,12414,12530,12853,12686,13449,13394,12634,12744,12646,12693,13368,13339,14480,14364,14405,14378,7275,7348,7009,6837,5109,4991,5815,5866,7319,7377,6941,7050,7452,7816,6859,6951,9899,10058,9954,10115,11324,11544,10839,10908,11030,10700,11353,11554,9886,9999,10065,10036,10489,10922,10813,10651,11043,11029,10949,10605,11793,11788,11460,11405,9944,10144,10007,9583,3821,4017,4038,3827,3931,4012,3902,3983,7262,7372,6618,6780,7466,7568,7776,7520,5948,5873,5974,5977,6838,6398,6861,6719,5624,5919,5375,6084,7057,6942,7493,7701,7323,7378,7473,7715,6029,5839,5597,6035,3943,3711,3960,3551,4018,3822,4041,3580,13409,13351,12591,12857,12532,12883,12477,12854,12964,12649,12994,12877,12503,13074,12935,12636,7468,7277,6955,6523,5758,5868,5102,5110,7352,7702,6841,6575,6751,6633,7705,7283,14852,14385,14410,14608,12707,12694,12752,12968,13089,12650,13571,13396,12878,12697,13450,13457,10680,10868,10929,10614,10663,10706,11033,10490,9194,9085,10117,9846,9901,10060,9849,9927,6064,5989,5611,5819,7010,6867,6630,7052,6862,6957,6620,7000,7335,7393,7494,7474,13573,13341,12858,13076,15360,15361,14496,14856,12885,12860,12507,12599,13355,13410,13827,13400,9469,9907,9167,9086,11365,11411,11440,11406,10040,10118,9902,9956,11794,11585,11295,11464,6983,6869,7940,7325,7824,7497,6842,7058,6896,7012,7278,7285,6963,6958,7380,7339,10611,10721,10814,10653,10066,9591,9660,9686,11354,11809,11556,11586,10843,10606,10708,10895,14624,14864,14528,14880,12996,12886,12889,12939,9699,9631,9701,10121,11140,11045,10855,10924,12709,13080,13090,12899,13452,13342,12890,12698,11796,11527,10950,10669,11413,11366,11034,10492,3933,3829,4042,3991,2015,2044,2031,2039,5874,5978,5598,6088,7944,7498,7394,7717,5503,6030,5935,6096,7706,7555,7476,7384,6583,7073,6634,6767,5990,6037,5113,5114,13458,13383,12519,12976,12941,12536,12657,12478,9201,9147,10011,9689,9850,9960,10068,10176,6815,6883,7060,6607,5847,5613,5993,5821,6987,6525,7584,7439,7447,7326,7505,7718,11369,11568,10613,10845,10081,9909,10013,10122,11088,10930,10953,10872,11560,11427,10722,11046,12652,12942,12947,12623,13574,13577,12768,12603,9931,10023,9196,9202,11356,11311,10667,11144,6051,5876,5980,5619,6641,7074,7840,7286,3947,3934,3830,4020,4049,3995,4044,3833,12509,12658,13473,13888,13357,13412,12901,12710,9690,9852,9149,9175,11531,11649,10654,10463,6965,6870,7105,7016,7500,7747,6636,6775,3949,4024,3567,3775,4007,4050,3055,3063,14406,14380,14467,14417,12713,12739,13952,13363,10903,10932,11810,11588,11075,10859,11472,11650,10712,10695,11036,11049,9910,9470,9933,9791,12902,12831,12523,12700,14386,14409,14351,14656,11414,11417,11429,11370,10129,10014,9150,9179,12631,12660,13460,13358,13063,12605,12510,12714,10954,10961,11077,10956,11104,11050,10846,11152,11319,11592,10962,10936,10027,9595,9913,9647,7708,7557,7341,7289,6873,6844,6587,6885,5851,5943,6042,5994,6038,5622,6053,5863,13387,13578,12741,12525,14469,14388,14359,14470,12847,13121,13092,13000,13585,13829,13416,13474,7721,7367,7952,7347,7396,7506,6989,7064,3955,3834,3575,3997,3950,3807,4065,3957,9823,9705,10082,9939,10617,10675,11057,10559,9204,9191,9702,10124,11800,11841,10861,11052,9934,10029,9692,10072,11812,11377,10724,10670,10055,9941,9208,8959,11418,11343,11533,11372,13122,12949,13096,13067,13365,13505,12905,12892,11078,10907,10728,10479,10618,10699,11842,11488,7480,7872,6526,6966,5087,5116,5880,6001,7558,7342,6995,6874,5614,5822,6041,5621,7722,7749,7561,7451,6642,7024,7290,7616,6886,6589,6615,6779,5996,5967,6112,5567,9914,10130,9968,10084,10035,10030,9655,10145,11430,11783,11816,11459,10862,10867,10677,10620,4011,4066,4052,3998,3836,4013,
4039,39
58,7076,6831,7521,7729,7047,6969,7371,7231,13464
,13389,12721,13008,13104,13124,12635,13185,1153
4,11905,
11787,11539,9706,9839,9887,9955,5853,5947,6054,6
002,7508,7562,6644,6990,6057,6083,5867,5625,6889
,6970,7
695,7750,13476,14080,13580,13586,12531,12950,12
742,12606,11058,10701,10736,10909,10919,10964,1
1081,108
69,7724,7349,7463,7453,6876,6590,7400,7292,3903,
4019,3579,3961,4056,3823,4014,4068,12963,12906,1
3830,13
366,14720,14412,14473,14418,13186,13069,12664,1
2716,14392,14363,14433,14375,10132,9679,10059,9
597,1059
1,10707,11844,11555,11323,11433,10678,10977,118
24,11378,10491,10702,9181,9195,9713,10146,10682,
10681,1
0709,10487,13395,13369,12953,13024,12855,13128,
12913,12526,7373,7350,7811,7730,7106,7080,6619,6
997,701
1,6781,7454,7753,5975,6044,5854,5949,7467,7522,7
379,7569,7051,6631,6839,6890,6972,6897,7353,7564
,6085,60
58,6004,5626,14595,14420,14474,14481,13833,1342
4,13447,13390,12647,12745,13601,13506,12687,130
75,12879,
12966,10037,9942,10177,10088,11541,11420,10923,
11082,11351,11461,11380,11434,9708,9847,9945,99
16,13397,
13588,12722,12965,12637,12533,12746,12954,12908
,12651,12415,12479,14597,14365,15362,15364,5869,
6065,6
086,5875,7512,7754,6998,7001,7813,7761,7703,7408
,7374,7263,6648,6943,9659,9957,9182,9197,10978,1
1139,10
910,11023,11325,11795,11789,11906,11089,11060,1
1545,11542,10968,11168,11790,11441,10061,10136,
9598,1003
8,10067,9946,9714,10096,11031,10607,11141,10870,
5979,6060,5950,6031,6399,7108,7495,7732,7968,757
0,7524,
7475,7053,6863,6621,7059,11557,11652,10925,1108
4,10873,10951,11355,11848,13070,12695,13834,133
70,13480,
13451,12724,12914,14379,14434,14851,14424,12859
,12753,13411,13398,9958,9661,9687,9851,12033,114
62,114
36,11384,12969,12534,12995,12638,13372,13592,12
887,12956,11465,11600,10493,10931,11326,11546,1
1064,111
42,4043,3962,3581,4021,2043,2045,2046,2047,5991,
5759,6008,5599,6066,5870,6089,5628,9151,9203,101
48,9903,
10926,10980,11090,10615,10684,10710,10723,10655
,11407,11367,11442,11558,7469,7585,6782,6892,708
8,7013,
7381,7736,6635,6843,8000,7756,6898,7002,7354,781
4,13078,12748,13401,13602,12537,12970,12861,126
99,1135
7,11908,11466,11856,10119,10041,9716,10062,1309
1,13077,12997,12653,14476,14366,14482,14407,138
41,13836,
13508,13453,12728,12916,12977,12662,7572,7395,6
622,7112,8064,7762,7586,7470,5981,5877,6090,6039
,7817,7
939,6527,7054,7528,7707,7279,7499,6959,7120,7014
,7061,4045,4072,3964,4022,3935,3831,4080,3582,99
61,1004
2,9948,9662,10725,11145,11587,11656,10178,10152,
9691,10069,11035,10713,11561,12034,14598,14601,
14497,1
4912,14381,14436,14976,14387,12711,12754,13081,
12538,13413,13459,13488,13454,10083,9853,10123,
9703,108
74,10984,11092,11200,13842,13633,13343,13512,12
659,12769,12862,12701,11371,11444,11105,10933,9
205,9087,
9911,9962,13402,13857,13604,13634,12891,12654,1
2756,12943,5995,5982,5878,6068,6871,6637,7382,74
77,7017,
6845,7356,7617,6097,6043,6092,5881,7385,7576,707
5,6900,5997,6072,5615,5823,7777,7764,7719,7818,7
004,664
3,7397,7327,11415,11473,11037,11146,11548,11912,
10955,11047,11358,11468,10714,10876,11562,11664
,11872,1
1616,14484,14382,14411,14602,13188,13093,12903,
12972,10044,9969,10070,10073,10934,10494,10957,
10815,97
20,10015,9471,10180,11153,11038,11589,11797,138
44,13575,12998,12717,14609,14853,14440,14498,75
88,7478,
7709,7941,6055,6098,5103,5111,6875,6967,7066,701
8,7778,7825,7062,6646,13461,13414,13082,12540,15
368,153
76,14389,14529,13417,13616,12661,12893,13136,12
978,13001,12920,13608,13475,12770,13094,13404,1
3359,127
15,13192,11419,11474,11569,11811,10125,9935,969
3,10131,13579,13697,12702,12511,12951,12980,138
58,13636,
11564,11373,11051,10619,9854,9964,9198,9206,405
1,4025,3067,3069,3835,4046,4026,3951,7501,7287,7
768,750
7,7077,6887,7386,7536,11448,11798,10937,10671,10
847,10729,11801,11379,10160,10085,9707,9915,111
06,1096
3,10726,11148,10958,11053,10716,11096,11431,114
89,11590,11570,11079,10965,12036,11421,11920,11
593,1093
8,11154,13123,12907,13520,13698,14488,14413,145
00,15104,12760,12743,13084,13097,13462,13465,13
477,1341

8,13002,13009,13125,13004,13152,13098,12894,13200,14604,14610,14854,14390,13367,13640,13010,12984,6904, 7025,7820,7398,7559,7481,7618,7710,7502,7401,6638,6846,7723,7942,7065,6645,7343,7291,7826,7780,7509,794 5,7020,6991,6003,5882,5623,6045,7136,6591,7388,7482,10992,11108,11374,11381,11059,11054,11476,11435,126 65,12723,13105,12607,14419,14393,14857,14448,6877,6971,7592,7563,7078,7026,7841,7751,5998,5855,6113,600 5,7081,7107,7523,7455,9970,10074,9694,10184,12040,11594,11490,11813,13848,13889,12909,13100,13860,1342 5,12772,12718,7351,7402,7293,7725,6891,6649,6999,7068,6059,6114,6100,6046,7828,7784,7510,7484,9599,1012 6,10031,10192,11802,11651,11572,11480,10679,11169,10730,10863,10086,10133,9209,9210,14471,14414,14625, 14530,13466,13391,13581,13420,10911,10979,11156,10703,9943,9709,10089,9917,4053,4054,3999,4067,3837,40 28,3959,4057,7409,7946,6878,6973,7731,7513,7620,7565,13126,12955,12776,12527,14421,14612,14858,14394,11, 083,10621,11680,11535,11543,11422,11601,11814,12666,12747 13890,13536, 13478, 13831,13864, 13507,10147,99 72,10076,9715,10737,11170,11936,11382,15392,15363,14504,14475,14435,14422,14396,14616,11061,10966,1120 1,11112,11596,11843,10732,10871,12910,12915,12725,12668,13582,13953,13835,13587,13106,12749,12784,1295 7,12967,13012,13129,12917,7109,7082,7571,7375,5884,6061,6087,6006,7842,7726,7953,7600,7028,6650, 7525,73 55,11804,11653,11437,11385,10969,10940,10683,10981,9947,10039,10138,10090,10134,9718,10149,9959,6893,7 089,7404,7832,7792,7755,7110,6899,7003,7084,7948,7873,5951,6067,5627,6009,11817,11463,12048,11443,11492, 11602,11085,11160,14425,14626,14865,14860,14532,14477,14437,14483,12639,12755,13892,13603,13371,13481, 12726,13025,13872,13426,12539,12750,12730,12729,12757,12535,7294,7410,7733,7566,6104,5871,6062, 6116,75 14,7624,6974,7055,7015,6783,7526,7573,13589,13468,12971,13130,13399,13509,13428,13482,11576,11968,1062 2,11062,9183,9212,9976,10097,7471,7737,7412,7763,7032,6623,7357,7734,4069,4058,4015,3963,4070,3838,3583, 4060,15365,15424,14512,14478,13026,13187,12958,13071,11654,11438,11091,10970,9710,9918,10137,9717,1181 8,11845,11657,11547,10738,11120,11386,11712,13373,13843,13837,13954,13137,13108,13593,13590,7844,7529,7 874,7757,7090,6894,7383,7954,6091,6010,5629,6069,7815,7516,7587,7574,10982,10685,10711,10875,10092,1006 3,10208,9663,11172,10927,11617,11825,11143,11065,11467,11327,9949,10043,10150,10098,11604,11658,10740,1 1086,10153,10179,9963,9721,10985,11066,11791,11846,14866,14657,14367,14536,13016,13216,13838,13489,130 79,12655,13189,12918,14426,14881,14628,14658,11820,11445,11559,11549,10972,10686,11496,11388,14868,145 99,14485,14438,13605,13700,12973,13132,12921,12999,13403,13896,14081,13510,13484,13432,11469,11446,119 07,11826,11202,11176,10715,11093,11107,10877,11550,11849,10071,10140,9950,10045,13513,13648,12541,1297 9,13374,13594,13112,13190,11563,11618,11475,11665,11147,10727,10935,10986,12974,13028,13138,12663,1273 2,12758,12771,12703,7632,7848,7113,6652,7005,6901,7969,7530,7114,7063,7758,7577,7019,7006,7738,7956,134 55,13415,13490,13606,13405,13956,13514,13904,12773,13193,13635,13704,14441,14640,14632,14499,7765,7740, 6902,7092,7387,7479,7876,7766,6093,6120,6012,6070,7769,7819,7589,7960,13083,12761,13609,14082,14428,14 383,14603,14721,15369,15366,14882,14660,12922, 13032, 13140, 13248, 11068, 10993, 11449, 11660, 10181, 10 154, 10 100,9722,9965,10161,10182,9971,11608,11850,11094,11097,7121,7067,7970,7779,7116,6905,7770,7578, 4073,402 3,3070,3071,4074,3965,4047,3966,11909,11857,11799,11504,11470,11359,10744,11039,10075,10156,10046,10127, 10495,11204,11591,11828,7399,7856,7021,7096,5983,5879,6128,5630,7821,7416,6639,6847,7537,7358,7532,782 2,12064,11666,11620,11571,11149,10959,10717,11155,13419,13492,13153,12981,13463,13521,13085,13194,1454 4,14722,14486,14489,14501,14442,14391,14664,13596,13960,13003,13095,13406,13516,12762,12924,7079,7122, 7827,7503,7648,7483,7389,7538,7781,7590,7593,7619,7782,7711,7403,7580,10087,9855,10104,9695,10162,9966, 10185,9724,13610,13712,13920,13664,12982,12542, 13005,12863,11565,11681,10878,10988,11184,11109,11477,1
1832,10731,10939,12096,11852,10994,11098,11450,11910,14872,14913,14884,14449,13201,13086,13637,13845,1
1668,11491,10718,11208,12160,11858,11682,11566,14490,14415,15377,15370,13467,13522,13617,13859,13612,1
3421,13099,12667,13496,13846,12985,12719,10077,9973,10186,10135,11913,12035,10623,11150,11624,11803,11
375,11595,11055,11216,11110,11157,6099,6073,5115,5117,7027,6906,7511,7540,6647,7069,7943,7485,7390,7594,
7022,6879,7621,7405,7137,7029,7727,8001,7972,7880,7083,7138,8002,7829,5883,6094,6074,5999,12895,12777,1
3849,13427,13154,13011,12774,13196,14605,14444,14914,14560,13006,13101,12764,13144,13479,13537,13638,1
3618,14502,14855,14888,14531,10091,10078,9974,10164,10967,10733,11478,11573,14606,14977,14859,14611,13
127,13013,14084,13469,11113,10941,11452,11713,10193,10139,10188,9977,4081,4027,4076,4082,4029,4055,403
0,4059,7976,7947,7785,7772,6101,6102,6047,6115,13968,13641,12986,13202,14916,14627,15378,15488,11481,11
672,11171,10996,10093,10168,9711,9919,7601,7888,7984,8004,7124,7070,6908,7085,7515,8065,7411,7830,5885,
6076,6007,6105,13040,13156,13422,13429,13107,13102,13524,13483,14088,13642,13538,13861,14395,14505,148
96,14450,11873,11860,11815,11914,11100,10739,11493,11423,13850,13699,13620,13528,12727,13217,12778,129
11,11684,11574,11805,12037,10151,10194,9199,9207,10971,11063,11162,11114,11874,11921,11158,10742,7622,7
486,7111,7030,7843,7786,6975,7091,8066,7949,7544,7596,7833,7904,6651,7033,11597,11383,11864,11603,11173,
10983,11482,11632,14613,14492,14423,14533,12959,13027,13204,12751,11000,11121,11916,11494,11655,11577,
11714,11806,13131,12669,13728,13583,13591,13470,13649,13862,6117,6106,6063,6011,7735,8008,7793,7406,71
28,6895,7527,7625,7086,7140,7567,7955,14452,14506,14397,14867,14861,14978,15372,15393,11598,11497,1073
4,10942,11819,12038,11161,10741,7759,7846,7602,7845,6118,5886,5631,6108,7517,7413,7626,7834,7788,7531,7
115,7034,11439,11387,11922,11876,11605,12041,11116,11087,12785,13218,13984,13430,13109,13014,13249,131
60,14617,14614,14862,14513,13644,13891,12780,12919,14629,14724,14427,14920,13852,13701,13485,13433,100
99,9978,9719,10141,11232,10687,11484,11578,13017,12988,12731,13029,13865,13511,14096,13491,15425,15380,
15105,14534,14508,14456,14537,14672,13540,13650,13133,13208,13624,14016,12670,13110,10973,11067,11688,
11659,11174,11122,11937,11847,10094,9951,10209,10101,11177,11203,11619,11551,11447,11498,11389,11821,1
0987,10745,11095,11164,13702,13486,13139,13018,14398,14618,15616,15394,7295,7359,7950,7575,7604,7794,6
653,7093,7117,7144,7739,7633,7849,7414,7875,7518,13866,13893,13705,13595,12786,13168,13434,13760,14479,
14439,14514,14630,13030,12733,12759,12923,10155,10210,10196,10142,11924,11880,11606,11580,11505,12042,
10974,11069,11827,11609,11716,11661,11205,11178,11667,11471,9980,10157,10183,10102,13220,12975,13665,1
3873,13191,13113,13515,13375,7036,7094,7767,7836,7958,7628,7417,7850,6121,6071,5118,5119,7007,6903,7152,
6654,7741,7579,7971,7957,7877,7533,7608,7796,7857,7542,7591,7634,7123,7097,7961,7418,14429,14980,14538,
14928,14659,14728,15384,15396,11938,11822,12049,11696,11124,10746,11621,11451,13652,13706,12788,13134,
14633,15106,14443,14516,13033,13114,13839,13894,13868,13493,13607,13597,14487,14545,14620,14984,13020,
12734,13544,13436,10989,11185,11500,11928,11888,11851,11206,10995,7539,7649,7742,7581,6122,6013,6095,60
14,6907,7118,7771,7534,7636,7823,7098,7023,11099,11180,12044,11969,10047,10163,9723,10105,13517,13494,1
3955,13874,13250,13224,12763,13141,13155,12925,13598,13897,13611,13666,13523,13713,13195,12775,12983,1
3034,15367,15489,14430,14540,11390,11506,11829,11662,10200,9967,10158,10212,11610,11720,11070,11151,11
111,10879,11622,11669,8068,7973,7125,7126,7783,7852,7878,7597,7962,7420,7071,7139,7541,7773,8016,7858,6
129,6075,6124,6130,7881,7800,7650,7974,7595,8072,7582,7391,7831,7860,8003,7787,14634,14736,14944,14688,
13116,13041,13497,13708,11567,11833,11508,11859,11128,10719,11453,11830,11940,11625,11970,11853,11186,1
0990,11479,12050,13656,13898,13142,13145,14661,14869,14491,14546,10187,10106,9725,10165,11911,
11612,11
683,11670,13957,13905,13847,13552,13518,13407,1
2792,13087,11728,11944,11209,10748,11101,10997,
12065,11
626,14641,14883,14636,14445,12543,13252,13639,1
3876,14112,13714,13668,13619,15426,15872,14520,
14870,11
210,11159,11854,11673,11115,11102,11834,12052,1
3197,13007,12765,13203,13613,13729,12926,13036,
13232,13
157,13525,13880,12779,12987,14144,13900,7640,76
23,7964,7977,6909,7100,7882,7889,8005,7884,8032,
7978,703
1,7129,7774,8080,14873,14451,14503,14561,14662,1
4642,15371,15400,11861,11836,10998,11188,11483,
11575,11
972,11862,13042,13146,13498,13958,13716,13539,1
2766,13256,14208,13906,13730,13614,13961,14083,
12671,13
198,10189,10216,10108,10166,11865,11915,11685,1
2056,11217,11163,12066,11875,11212,11001,11866,
11674,78
90,7864,7545,7603,7141,7130,7985,7487,6077,6103,
6078,6107,7789,7980,7652,7598,11495,11952,11117,
11192,10
079,9975,10224,9726,15108,14493,14992,14665,144
46,14453,14548,14507,11917,11512,10735,10943,11
633,1145
4,11628,11918,15428,15490,15112,14666,14562,148
85,14874,14723,8006,7835,7087,7035,7656,7407,754
6,7627,7
790,7795,7605,7548,7986,7629,7142,6910,13672,138
51,13423,13643,13103,13264,13158,13205,11175,11
218,119
23,11599,11744,11579,11485,11634,7664,7837,6655,
7132,7847,7892,8009,7797,7519,7635,7606,7905,613
2,6119,
6136,5887,14644,14552,15379,15373,14752,14607,1
4615,14494,13015,12781,13526,13621,13161,12989,
13500,13
761,11877,11686,11689,11715,11878,11807,11499,1
1676,13529,13720,13219,13044,13921,13908,13863,
13962,15
408,15374,14673,14886,13148,12787,13541,13471,1
5008,14454,14668,14915,13732,13622,13853,14085,
7419,763
0,7610,7609,7145,7095,7637,7415,4084,4071,4088,3
839,4061,4075,4062,4077,10195,10169,9211,9213,11
123,110
02,11607,11636,10743,11165,12039,11581,11486,11
690,11118,10975,14876,14725,14509,14457,13019,1
3111,132
10,13162,11717,11501,11233,11125,11823,12097,12
068,11976,13922,13969,13206,12790,13645,13431,1
3912,136
51,14889,14535,15120,14515,13221,13031,13530,13
680,11179,11234,12098,11925,9979,10190,10170,10
095,1456
4,14674,14648,15040,13048,13169,13964,13542,120
72,12043,11881,11868,10197,10198,10143,10211,15
432,1561
7,14726,14510,13703,13625,13762,13854,13646,135
45,12782,12990,14890,14917,15381,15492,13867,14
086,1320
9,12789,14729,14619,14458,14784,13487,13435,139
70,13924,13653,14089,13164,13135,11697,11984,12
080,1210 0, 11220,11166,11004,
11181,14689,14897,15395,15618,14539,14399,14676
,14730,11611,12161, 11507,11926,9981,
10172,10103,10201,13280,12735,13532,13626,13021
,13115,13736,13707,13222,13170,13985,13895,1322
5,13251,
13667,13599,14863,14918,14892,14517,13495,13546
,13437,13869,11718,11582,11207,11126,11939,1188
2,11071,
11187,7851,8010,7906,8067,7838,7951,8017,7988,78
96,8096,7959,7535,7146,7037,8069,7798,12162,1204
5,11640,
11692,11929,12000,10747,11129,13035,12793,13143
,13212,13972,13928,13654,13628,10213,10202,1015
9,10107,
11831,12104,11889,11502,14631,14621,14568,14460
,13553,14090,13022,13117,11224,10991,11623,1172
1,11182,
11236,11663,12051,14541,14518,14979,14898,13875
,13657,13764,13709,7853,8012,7801,7879,6109,6123
,6110,6
125,7421,7859,7119,7038,7992,8070,7854,7908,1185
5,11942,11698,11941,10214,9982,9727,10204,14622,
14921,1
5386,15873,14635,14690,15440,15397,13253,13226,
13715,13519,13986,13870,14097,13744,13172,12794
,13669,1
3499,14547,14737,14521,14732,11613,11509,11722,
11930,11884,11627,11211,11130,11391,11455,12046
,11671,11
700,11890,10749,11189,8018,7543,7612,7638,7651,7
583,7653,8073,7153,7099,7963,7641,7802,7912,8020
,8128,1
5385,15382,14680,14922,14981,14929,14871,14576,
13037,13233,13548,13976,13936,13899,13254,13043
,14542,1
4431,14663,14900,15136,14738,15496,15620,11213,
11240,11835,11729,11945,11510,11971,11614,13147
,13228,1
4092,14017,13438,13554,13877,13710,13658,13768,
13118,13199,13159,12927,13670,13717,11132,11190
,11863,1
1932,12054,11724,11513,11946,13615,13881,13556,
13907,14692,14643,14637,14753,8033,7861,7965,80
74,7883,
7975,7148,7154,6079,6131,6133,6015,7642,7804,710
1,7127,15624,15398,14549,14904,13176,12767,1350
1,13878,
15168,14924,14522,14982,13988,13673,14018,13901,10217,10167,9214,9215,11103,10999,11248,10750,1
3234,13
038,13527,14098,13959,13660,13731,13718,11837,1
1675,12067,12053,11973,11629,11704,11892,14740,
14563,15
232,14930,13776,13992,13257,12796,14754,14638,1
5874,15456,14985,15107,14696,14875,11953,11638,
11687,11
730,11219,11193,12057,11514,11635,11745,11838,1
1677,10218,10109,10191,10110,13149,13045,14113,
13674,13
258,13207,13902,13721,7862,7422,7885,7743,8081,7
966,7102,7131,7979,7547,7865,7599,7775,7657,8034
,7891,1
5427,15401,15504,15388,14447,14667,14550,14645,
13163,13150,13882,14100,14524,14785,14553,14744
,7156,71
43,7654,8076,7886,7981,7644,8024,8007,7893,7160,
6911,7866,8082,7920,8036,13909,13884,13046,1323
6,14945,
14932,14887,14986,11003,11214,11867,11630,11732
,11919,11194,11119,12164,12069,11221,11222,1187
9,11948,1
1974,11693,13531,13623,14020,13910,13913,13963,
13733,14104,15429,15402,14565,14495,13265,13211
,14114,1
3923,13260,13049,13914,13722,14756,14646,15876,
15409,12058,11516,11167,11235,11637,11869,12112
,11954,1
4877,15109,15434,15632,14946,14993,14669,14455,
14936,14675,14554,14704,13543,14000,13165,13240
,14988,1
4566,14727,14649,13965,13560,12783,12991,10225,
10171,10220,10226,11977,11896,11746,12070,13681
,13502,1
3676,13966,13223,13266,13971,13647,7987,7982,76
07,8097,7658,7791,7839,7907,8084,7631,8011,7549,
7133,714
7,7665,8098,13792,13627,13533,13682,13925,13734,
13737,13763,14786,14878,15520,15880,14670,14569
,14891,
15110,14511,14459,14994,14948,15648,15888,14677
,15113,11691,12168,11678,11487,11927,11956,1209
9,11883,
11736,11719,12060,12073,11005,11196,11978,11985
,13926,13855,13547,13724,14556,14650,15552,1590
4,12101,
11980,12128,12074,11127,11225,11870,12176,13171
,13050,13655,13684,14760,14731,15009,14919,1198
6,11960,
11641,11699,11237,11226,12081,11583,12791,13213
,14087,13629,13534,13738,13166,13023,15430,1540
4,14691,
14623,13765,13549,13281,13173,10173,10199,10174
,10203,11885,12076,11748,11694,14519,14570,1549
1,15441,
13871,14145,14116,14024,14461,14893,14996,14952
,13227,13282,14146,13973,7989,7894,8129,8040,766
0,7799,
7897,7868,7611,7909,7134,7149,8013,8088,7550,799
0,15410,15433,15375,15680,14120,14091,13929,139
16,1467
8,14652,14577,15114,14899,14681,14788,14733,121
02,11931,11183,11131,11752,11503,11642,11723,13
745,1403
2,14128,14148,13268,13214,13052,13229,11886,118
91,11701,11644,12082,11725,11238,11006,13659,14
209,1355
5,13974,15493,15412,15383,15494,14739,14543,150
10,14894,15121,14768,14693,14523,11760,11933,10
751,1122
8,11943,11988,12105,11893,8019,7898,7666,8048,79
10,7613,7639,7803,7103,7155,8100,7855,8071,7993,
7668,80
14,14572,15000,14960,14923,13766,13630,13255,13
174,11615,11731,11702,12001,10228,10215,10232,9
983,1574
4,15436,15116,15041,13987,13930,13119,13235,142
10,14093,13688,13740,14462,14578,14901,14734,11
515,1172
6,11706,11705,11241,11191,11733,11511,13977,140
48,12795,13177,13879,14152,13937,13550,13272,13
039,1367
1,13769,13230,13284,13711,14099,15497,15442,146
82,14792,14694,14741,15416,15387,13903,13990,13
746,1398
9,15457,15399,14639,14905,14580,14931,14525,149
02,13661,13557,13770,13978,13932,13675,13259,13
178,1501
2,14697,15042,14925,13439,13503,14094,13719,145
51,15122,14983,14684,7913,7994,7900,7614,8130,81
04,7643,
8021,4031,4083,4085,3967,4078,4086,4089,4090,119
47,12106,12002,12163,11934,12047,12113,12084,14
755,147
42,14800,15016,15137,14698,15619,15444,11992,12
192,12055,11631,11242,11133,12165,11894,14926,1
4745,154
98,15505,15621,15389,14906,15124,13748,13938,12
797,13237,13261,13288,13883,13777,11949,12108,1
1897,119
75,10205,10219,10206,10221,13993,13558,14019,13
662,13180,13238,13911,13980,11517,11955,11215,1
1134,120
88,12166,11950,12004,14102,13772,13561,13994,14
933,14908,14555,14647,15403,15458,15875,15448,1
5044,149
34,14937,14987,12114,11639,11708,11734,11747,11
679,11749,12169,13151,13047,13296,12798,14757,1
5128,151
38,14947,8035,7805,8075,7655,7157,7039,7863,7914
,7996,7921,8022,8025,7672,7967,7423,8132,13885,1
3723,14
115,14101,14021,13677,13752,13940,15500,15390,1
4938,14746,14001,13686,13735,13778,8077,7887,76
45,8083,

7806,7916,7150,7158,8112,8037,7659,7867,6126,6134,6137,6138,15506,15431,14567,15024,14989,14584,14705,1 4526,13267,13241,14105,13562,13683,13793,13886,13725,11249,11195,12059,11737,11898,12008,12116,12224,1 2129,11957,12061,12170,11979,12071,11244,11250,14700,14990,14995,14671,15622,15625,14816,14651,14557,1 4706,15521,15936,13051,13262,13915,13678,7922,8026,7646,8136,7551,8078,7983,8144,8038,8085,7161,7162,78 95,7661,8041,7869,15405,15460,14949,14758,13780,13967,13242,13167,10175,10227,10229,10111,11738,11900, 11197,11223,14761,14787,16000,15411,14212,14117,13269,13270,11958,11518,11981,11839,12177,12062,11198, 11227,14950,14879,14571,14748,14679,14708,15508,15406,13927,13996,14022,13741,15111,14653,14558,14762, 14106,13564,13215,13283,13685,13917,14160,14002,12075,11643,11961,11695,11871,11753,12130,11987,8099,7 924,8028,7667,7899,7991,8090,8042,8086,7670,8101,7911,7135,7164,7928,8049,14025,13944,13794,14118,15435, 15626,14789,14573,13739,14216,13726,13535,14895,15169,15140,15048,11252,11239,11750,12172,11982,12077, 11740,12120,15633,15877,15464,15522,13975,14004,14147,13931,12103,11989,11256,11007,11962,12178,12016, 12132,13784,13767,14108,14121,15170,14997,15144,15115,15413,15553,14953,14940,15512,15437,14769,15056, 13053,13244,14026,14033,15152,15172,14683,15233,7662,7870,8089,7669,8044,8015,8160,7615,7901,7995,8102, 8050,8105,8131,7915,7673,15524,16128,15628,15634,14579,14998,14790,14654,14149,14028,14176,14122,1317 5,13273,13918,14224,14034,14008,13689,13747,15011,14954,15878,15414,12083,12078,11703,12193,11754,1188 7,11935,12003,15234,15117,14712,14764,15443,15417,15001,15072,13285,13274,14129,13631,13933,14124,1379 6,13742,14150,13979,13231,13179,14903,15176,14961,14574,12180,11727,12107,11645,11229,11243,11761,1219 4,12085,11990,12225,12136,11756,11895,11993,11964,15881,15472,15495,15438,13800,13551,13690,13771,1469 5,14793,15649,15554,14735,15123,14927,15014,15445,15636,14770,15013,13934,13939,13749,13692,11707,1200 5,11230,11245,12109,12184,11646,12086,14130,13773,13286,13054,14685,14581,14794,15002,14956,14699,1446 3,14527,15118,14743,15882,15418,13808,13981,12799,13276,13991,14036,14153,13941,8023,8092,7902,7997,81 33,8106,8052,7674,4063,4092,4079,4087,4091,4093,4094,4095,12115,11994,11762,12144,12006,11709,11735,118 99,11199,11251,12196,11951,12167,12089,11764,12110,15528,15499,14772,14962,13663,13779,13750,14049,135 63,13774,13754,13753,14907,14801,15459,15446,13289,13239,13781,13559,15017,14582,15043,14686,13995,141 54,14050,14211,15420,15640,14935,15004,15126,14796,15449,15650,13982,14095,14161,14132,14585,15018,149 09,14747,15139,15125,15045,14701,12009,12090,11996,11710,12226,12200,11739,12117,15889,15884,15556,155 01,14040,14240,14103,13679,14776,14964,15025,14710,14759, 14802, 15129,14586,13290,13181,14213,13942,139 97,14156,13945,14023,7917,8113,8134,7923,8027,8108,7998,8079,8039,7807,8056,7647,8114,7918,8137,7676,12 131,11901,12171,11751,11253,11135,11959,12010,13565,14003,13263,13182,15461,15507,15536,15502,14136,14 214,13998,14052,15890,15681,15391,15560,12092,12017,12118,12121,11768,12063,11519,12228,14707,14817,14 910,14749,14162,13687,13756,13782,12173,11983,11741,12179,11902,12012,11246,11254,15450,15905,15652,15 682,14939,14702,14804,14991,13795,13727,13797,14217,15236,15141,14951,15020,15892,15623,15046,14765,15 509,15462,15130,14588,12208,12133,11755,11963,10222,10230,10233,10234,13297,13243,14107,13785,13946,14 056,14164,14272,15465,15664,14709,14941,14177,14005,14109,14218,8029,7925,8138,8087,6111,6140,6127,613 5,8043,8030,7926,8116,8145,8091,8140,7929,15184,15026,15049,14968,15656,15523,14818,15142,14027,14119,1 3292,13298,15452,15407,14763,15240,13786,13948,13245,13271,15627,15745,14750,14559,14999,15028,15906,1 5684,15171,14955,15568,15746,14808,14791,15132,15145,14006,13566,14029,13887,15510,15513,15525,15466,1 4225,14110,13246,13275,15050,15057,15173,15052,15200,15146,14942,15248,15415,15688,15058,15032,14123,1 3691,14009,13743,12018,12122,11742,12232,11647,12174,12079,12240,13919,13801,14178,14035,14713

,14771,15153,14655,13300,13287,13798,14220,15896,15937,14957,15148,14030,14125,13788,14168,15908,15473,14820,14766,12134,12181,11257,11258,11991,11757,12137,11965,14151,14037,13304,13055,15514,15439,15629,15468,15174,15003,14824,14575,14714,14795,15938,15584,14010,14226,14064,14180,14131,14126,13751,14241,12195,12020,12124,11763,11995,12087,12186,12138,15526,15879,15912,15555,14958,14963,14773,14716,8045,8120,7663,7871,8103,8146,7151,7159,8051,7930,7671,8093,8046,7903,8161,8053,15630,16001,15883,15635,13802,13935,13983,14051,15154,14797,14832,15005,15015,15060,15177,14965,14228,13775,14155,13693,14687,14803,15940,15651,12182,11766,12197,12007,11231,11260,12024,12145,15419,15529,14774,15073,15920,15474,14587,14798,13277,13291,13809,14242,14778,14777,14805,14583,14133,14038,14273,14184,15637,15516,15019,15178,15447,15557,15476,15530,13804,13943,14041,14012,13755,14053,13278,13293,15074,15235,15006,15119,11758,11966,12185,11765,12140,12111,12256,11711,15421,15891,15885,16002,15185,15156,15641,15638,11997,12091,12198,12146,12201,12227,12011,11769,15064,15264,15886,15537,14157,14232,13694,14134,14163,14042,13810,14192,15127,14703,15237,14966,15653,15748,15021,15180,14969,15047,15451,15944,14054,13757,13783,13947,16129,15558,15532,15480,8107,8162,8148,8094,7932,8109,8135,8054,7999,8115,7675,8057,8152,7919,8110,8164,15561,15696,14589,15027,15422,15642,15160,15238,13247,13299,14244,13999,15022,15076,15186,14711,12119,12188,11998,12093,12229,12202,12148,11770,14780,14806,14819,14751,15503,15463,15538,15654,15453,16004,15562,15952,14215,14137,13812,14158,14057,14138,14044,13758,14821,15241,15683,15752,14274,14248,13787,14165,15131,14809,15657,16130,14179,13949,14219,13799,14970,15080,15188,15296,15467,15540,15201,15029,13301,13183,14007,14058,15511,15569,15133,15242,15644,16008,15051,15143,12013,12209,12230,12019,12123,12204,12094,12175,15454,15564,14810,14972,15658,15760,15968,15712,14140,14065,14166,14169,15030,14590,15053,14911,13816,14111,13567,14276,15249,15134,15685,15893,8139,8058,7677,8117,6139,6141,6142,6143,8141,8168,8060,8118,8031,7927,8176,7678,15515,15570,15665,15907,14221,14031,13789,14227,12135,11903,12152,11743,12210,12014,12233,11772,15660,15469,15147,14715,13950,14060,13294,13302,15544,15894,15033,14767,14943,14825,15897,15475,14256,14181,13803,14011,15202,15059,14822,15244,15054,15149,14812,15192,15527,15585,15686,15666,15175,15061,16132,15517,16016,15689,15034,15250,15088,15204,15470,15477,15155,15150,15572,15531,12125,12021,12234,12183,10207,10236,10223,10231,14066,14170,13790,14280,16136,15690,15586,15909,13695,14222,14127,14288,15898,15747,15668,15576,14775,15265,14826,14959,14182,14229,13305,13306,15007,15075,15252,14799,14039,13805,14185,14013,15179,14717,15776,15631,15639,15518,15697,15910,14243,14068,14172,13811,14833,15266,16032,15478,12139,12126,12022,12212,12241,12187,12236,12025,8147,8121,7163,7165,7931,8142,8122,8047,8149,8150,8095,8163,7933,8124,8055,8153,15157,15062,15297,15208,15692,15939,14828,14967,12141,12216,11759,11967,12199,12242,11247,11255,15900,15749,15533,15481,15065,15036,14779,15077,14043,14135,14234,14186,14230,13814,14245,14055,15913,15559,16144,15539,15588,15698,15181,15256,12147,12026,11767,12189,12142,11999,12257,12149,15672,16064,14718,15158,13279,13308,14072,14193,15750,15534,15187,15066,13806,14014,14233,13813,15914,15941,15753,15643,14834,15216,15482,15808,15078,14781,14807,14971,14188,14159,14304,13759,12203,12258,12244,12190,12028,12205,12231,12150,15268,15023,15713,15921,15239,15161,15563,15423,14045,14139,14246,14194,15700,15754,14836,15182,14249,14275,14059,13817,15081,15162,15887,15942,15916,15541,15655,15645,15068,14782,15592,15484,12095,12211,11771,12153,12248,12015,12206,12260,15565,15542,16003,15922,15298,15272,14811,15189,15203,14973,15646,15945,14167,14236,14046,14141,15659,15714,15571,15761,15243,14823,15031,15082,15164,15089,15545,15756,14277,14250,14196,13818,14061,14257,14278,14067,15704,15946,15190,15

193,16005,15953,15895,15600,15566,15455,14840,1
5135,141
71,14252,14142,14223,14591,15300,15687,15924,16
160,15762,15716,15667,15245,15055,14813,15251,1
2235,121
54,11773,12213,10235,10237,10238,10239,14183,13
951,14200,13791,14258,14062,14281,13820,15661,1
5777,149
74,15084,15280,15205,15573,15928,14827,15035,16
192,15948,15090,15194,15546,16006,15764,15587,1
4814,153
04,16256,15954,15778,15662,14173,14069,14282,14
231,16009,16131,14719,15246,15720,15899,15471,1
5691,151
51,15312,15206,15253,12237,12264,12156,12214,12
127,12023,12272,11774,14187,14174,14070,14260,1
5063,148
29,15574,15669,15209,15037,15548,15809,14289,14
235,14284,14073,15577,15768,15267,15092,14189,1
4264,138
07,14015,15969,15956,15911,16010,15196,14835,15
589,15519,15780,15670,15901,16133,14247,14290,1
3295,133
03,15067,15159,15258,15210,15970,16017,15254,14
838,12243,12217,11259,11261,12027,12238,12218,1
2143,156
93,15479,15960,15699,15269,15079,15578,15728,15
096,15217,16012,15590,15751,15673,15810,15902,1
5694,155
93,14830,15038,15915,16134,15257,14837,15535,15
483,16018,15972,15701,16137,15212,15183,14195,1
4074,138
15,14237,15328,14783,15580,15674,15069,15163,15
784,15755,15270,15218,16033,15943,14190,14047,1
4305,141
97,15273,15299,15715,15647,15543,15594,15485,15
917,15083,14841,15191,15260,14251,14306,14292,1
4238,160
20,15976,15702,15676,12245,12246,12191,12259,12
029,12220,12151,12249,15601,16138,15070,15165,1
5923,157
05,15812,15757,15301,15274,15763,15567,14076,14
253,14279,14198,16034,15918,16145,15792,15220,1
4842,157
17,15547,15085,15281,15596,16024,15984,15947,15
302,15091,15195,15276,16140,16065,14143,14259,1
3819,142
01,15486,15602,15925,15758,14296,14063,14254,
14308, 15706, 15816, 15166,
15247,15207,14975,15718,15765,156
63,15929,15604,15955,15224,14815,15549,15926,12
261,12250,12207,12155,12262,12030,11775,12252,1
6036,157
21,16066,15949,15282,15086,15575,16146,14283,14
202,13821,14261,16007,15708,15779,15766,8165,81
54,8111,
8059,8166,7934,7679,8156,8169,8119,7166,7167,817
0,8061,8143,8062,15824,16040,15305,14844,15197,1
5093,16
161,15722,15306,15255,15950,15769,15211,15198,1
5930,16148,15957,15932,15094,15284,15579,15671,
16068,15
958,14285,14312,14204,14262,15961,16011,15781,1
6152,15313,15259,16162,15971,15308,15097,15962,
15770,12
265,12215,11262,11263,12266,12157,12239,12158,1
5591,16048,15213,15288,14175,14071,14320,13822,
16013,15
608,14831,15039,15729,15550,15724,16014,15271,1
5314,16019,15695,15840,15675,15581,15730,15973,
15782,15
785,15811,15974,15903,15595,15772,14291,14265,1
3307,13309,15219,15098,15703,15732,14839,15261,
16135,15
677,15582,15786,15214,15071,15813,15597,15329,1
5221,15919,16193,16164,16072,15275,15330,16194,
16021,14
075,14286,14266,14191,12273,12219,12268,12274,1
2221,12247,12222,12251,16168,16139,15977,15964,
14293,14
294,14239,14307,15793,16080,16176,16196,15316,1
5262,15100,15277,15707,16257,15603,16022,14077,
14268,14
199,14297,15814,15678,15303,15222,16035,15978,1
5167,15283,16258,16141,15736,15788,16025,16096,
14843,15
225,14309,14298,14255,14203,15927,16200,15985,1
5598,15320,15087,15719,15817,15278,15332,15759,
16147,15
951,16038,15794,16037,14310,14078,13823,14300,1
5709,15605,15818,16026,15980,15723,15307,15226,
15487,15
551,16142,15767,15796,15986,14845,15285,15309,1
5336,15931,15825,16041,15606,16067,15710,15228,
15286,15
959,16028,16150,15820,15609,16042,14313,14263,1
3310,13311,15199,15095,15344,14846,15933,15771,
16163,16
149,16069,15725,15800,15988,16049,15734,15783,1
5826,15315,15289,16153,15610,15731,15841,15934,
15773,14
314,14205,14287,14206,15099,15310,15963,15726,1
5828,16015,15290,15215,16260,16165,15317,15318,
15975,16
044,16070,15789,16154,15612,15263,15331,15733,1
5965,16208,16050,14321,14267,14316,14322,16073,
15992,15
842,16166,15787,16264,15774,15583,16023,16052,1
6195,15979,15832,15815,16156,16169,15101,15292,
16074,16
081,16197,16076,16224,16170,15223,15321,15966,1
6272,8177,8123,8172,8178,8125,8151,8126,8155,818
0,8167,8
184,7935,8157,8171,8158,8173,16082,16056,15737,1
5795,15333,15322,16177,15679,14269,14295,14270,
14299,1 5981,16172,15844,15790,16198,16027,15279,15227,
15848,15599,15738,15819,15982,15987,15797,15740
,16178,1
5821,15334,15102,15856,16029,14847,15324,16039,
16084,16201,15989,15711,15827,15798,16097,14324
,14311,1
4328,14079,15611,15822,15802,15801,15337,15287,
15829,15607,12276,12263,12280,12031,12253,12267
,12254,1
2269,16043,16202,16098,16259,16030,16143,16209,
16180,16088,16288,16151,15727,15338,15229,16261
,15990,1
6045,16204,15993,16071,14301,14315,14302,14317,
15613,16051,15311,15230,16184,16262,16046,16100
,16210,1
5735,15804,15830,15843,15775,15845,16265,15345,
15291,16155,15833,15994,16104,16212,16320,16225
,16053,1
6157,16266,16075,16167,15340,15346,14271,14323,
14325,14207,15834,15996,15293,15319,16054,15614
,16077,1
5935,16273,16158,15294,15323,16171,15739,16057,
15791,15967,15849,16226,16083,15348,15335,15846
,16268,1
6078,16173,15836,16216,16199,16085,15352,15103,
16058,16274,16112,16228,16179,16174,15799,16289
,15850,1
5983,16031,16099,16276,15823,16203,15741,15325,
15339,15857,16290,8127,8179,8181,8063,8174,8182,
8185,81
86,8159,8188,8175,8183,8187,8189,8190,8191,16181
,16086,16321,16232,15852,15991,16089,16060,1580
3,16101,
15326,15341,16205,16280,15742,16182,16211,16090
,15858,16240,16102,15805,15831,15995,15295,1534
7,16292,
16047,16263,16185,15860,16206,16105,16186,16092
,15806,16322,16296,15835,16213,12223,12275,1227
7,12159,
12270,12278,12281,12282,16227,15997,16267,15847
,15349,15231,16055,16106,16188,16113,16214,1621
7,15864,
16159,15615,16324,16269,16079,15837,16275,15998
,16108,15342,15350,16304,16229,15851,16059,1431
8,14326,
14329,14330,16114,16218,15838,16328,15743,16270
,16175,16336,16230,16277,15353,15354,16087,1585
3,16233,
16061,16291,16116,16220,15859,16091,16183,16282
,16234,16278,15862,16293,16103,15327,15356,1612
0,16241,
15854,16062,16281,15861,16236,16207,16352,15807
,16093,16187,16294,16242,16297,16323,16107,1586
5,16215,
16284,16094,16189,16325,16298,16244,15866,12255
,12284,12271,12279,12283,12285,12286,12287,1610
9,16305,
16326,16115,16219,16300,16190,16271,16231,15999
,16248,15839,16306,16110,16329,15868,16221,1611
7,16330,
16279,14303,14332,14319,14327,16235,16222,16118
,16308,16337,16283,16332,16121,16237,16312,1585
5,16063,
16295,16338,15343,15351,16243,16122,15863,16285
,16238,16095,16353,16245,16299,16354,16340,1628
6,16124,
16301,16327,16246,16191,16307,15867,16249,16344
,16111,16302,16356,16331,16250,15869,16309,1433
1,14333,
14334,14335,16333,16360,16252,16310,16223,16119
,16368,15870,16339,16313,15355,15357,16123,1633
4,16314,
16239,16341,16342,16287,16355,16125,16316,16247
,16345,16357,16346,16303,16251,16358,16126,1587
1,16348,
16361,16311,15358,15359,16362,16253,16335,16254
,16369,16315,16364,16370,16317,16343,16318,1634
7,16372,
16359,16376,16127,16349,16363,16350,16365,16319
,16371,16373,16255,16366,16374,16377,16378,1635
1,16380, 16367,16375,16379,16381,16382,16383]

**Sequence group 2: Z2_16384**

[0,1,2,7,3,8,11,24,4,10,13,28,16,33,35,78,5,1
2,14,32,19,38,47,82,22,46,42,89,57,97,105,174,6,17,2
1,40,
23,45,51,91,29,55,59,100,73,112,117,189,34,61,76,11
5,81,126,139,206,88,141,151,232,158,242,276,409,9,
18,26,54,
30,58,72,107,36,77,62,118,85,133,145,213,44,75,87,1
40,93,148,157,238,103,160,176,266,188,284,302,449,
53,90,1
01,156,113,166,183,281,122,184,205,294,217,319,34
0,488,143,211,235,325,240,341,365,547,273,371,402,
569,419,
596,648,906,15,25,31,74,39,80,83,144,48,86,94,155,1
04,165,171,280,56,95,106,167,116,182,202,296,132,2
03,212,
314,237,333,359,531,66,110,123,187,134,204,220,32
6,154,233,241,343,272,370,383,568,170,255,282,375,
295,415,
421,592,322,438,470,635,504,670,743,907,70,127,14
7,223,164,239,271,373,175,274,286,408,303,420,448,
629,200,
297,315,436,342,466,490,684,353,506,550,714,576,7
52,806,1075,219,327,348,473,376,530,553,738,418,5
65,593,7
78,636,811,879,1155,447,618,649,844,668,901,937,1
239,741,948,979,1234,1051,1330,1429,1820,20,37,41
,92,49,9
6,108,181,50,109,119,190,136,216,224,357,63,120,13
7,227,149,236,253,358,159,252,277,401,298,417,424,
591,68,
146,161,229,178,264,283,416,186,292,308,432,318,4
58,477,666,185,316,329,457,352,491,533,715,378,55

5,577,751,617,805,847,1123,79,173,179,288,195,312,328,450,207,335,347,489,366,546,564,747,275,362,377,549,410,574,616,800,442,621,654,838,687,900,939,1224,311,404,433,590,456,634,656,888,482,681,697,905,744,955,1021,1281,551,742,753,1012,801,1058,967,1339,866,1120,1160,1451,1203,1569,1630,1894,84,191,201,351,265,369,382,554,289,400,411,585,439,623,651,892,309,437,453,628,472,657,693,913,507,701,735,951,779,1015,1074,1343,356,459,476,692,532,728,759,976,584,764,807,1070,867,1035,1143,1455,633,834,898,1121,918,1202,1230,1548,964,1237,1236,1610,1340,1685,1733,2113,403,505,560,765,622,810,846,1097,655,889,902,1161,945,1209,1235,1559,694,933,977,1225,1022,1238,1341,1686,1096,1369,1422,1742,1470,1834,1870,2333,750,1013,1066,1342,1142,1360,1462,1761,1154,1457,1550,1844,1598,1945,2058,2510,1210,1584,1668,1973,1714,2083,2027,2600,1814,2145,2225,2762,2359,2906,2979,3410,27,43,52,102,60,121,138,221,67,142,150,226,163,244,254,412,69,162,172,243,180,313,323,446,208,324,350,483,368,540,561,777,71,177,194,317,210,349,363,510,222,372,388,566,414,597,631,816,234,405,423,620,451,650,671,876,467,667,706,932,713,950,1014,1431,111,209,218,367,228,389,413,587,267,425,443,639,469,683,700,894,287,445,475,669,509,712,725,942,548,726,734,1020,831,1059,1110,1456,310,508,544,731,571,758,776,1030,599,830,849,1089,904,1138,1200,1551,638,878,919,1201,965,1215,1283,1599,1063,1304,1380,1687,1423,1745,1838,2301,114,225,245,422,285,444,471,686,299,480,511,727,552,740,745,1023,334,545,570,746,598,825,845,1076,637,874,903,1153,943,1211,1262,1556,364,586,630,848,680,899,895,1212,695,936,949,1242,1031,1302,1336,1689,739,966,1061,1331,1077,1395,1428,1762,1119,1454,1498,1845,1609,1949,2059,2511,379,647,682,938,724,954,1034,1305,819,1062,1104,1418,1107,1430,1468,1833,835,1105,1118,1461,1213,1485,1589,1944,1276,1608,1635,2020,1732,2116,2182,2607,875,1231,1260,1557,1337,1611,1684,2037,1381,1720,1763,2144,1839,2272,2345,2777,1520,1773,1864,2279,1963,2393,2426,2977,2044,2481,2577,3060,2702,3240,3387,3899,135,270,293,481,332,541,567,804,346,575,619,827,646,865,912,1263,374,632,685,893,707,953,944,1280,729,978,1050,1368,1098,1398,1437,1815,452,696,730,952,818,1029,1067,1419,826,1099,1109,1450,1139,1469,1525,1932,836,1122,1208,1524,1269,1588,1631,2021,1334,1693,1721,2117,1772,2183,2298,2750,468,817,824,1088,837,1106,1152,1484,877,1214,1243,1568,1303,1626,1715,2103,1060,1268,1338,1634,1382,1743,1802,2146,1471,1803,1865,2288,1972,2392,2409,2976,1108,1394,1460,1744,1521,1841,1934,2300,1591,1948,2023,2408,2102,2502,2606,3071,1669,2045,2121,2576,2224,2631,2743,3260,2332,2763,2851,3323,2924,3577,3603,4405,474,839,864,1261,1028,1282,1335,1692,1071,1361,1399,1760,1463,1832,1895,2299,1111,1436,1499,1835,1558,1935,2026,2397,1627,2082,2022,2477,2147,2601,2701,3146,1277,1549,1585,1962,1688,2036,2120,2516,1741,2124,2209,2676,2289,2703,2780,3322,1840,2273,2344,2751,2427,2907,2925,3433,2503,3025,3070,3721,3241,3770,3814,4272,1383,1590,1740,2125,1821,2208,2278,2742,1871,2358,2396,2850,2480,2908,3061,3602,1933,2476,2517,3024,2700,3078,3079,3771,2776,3261,3297,3815,3411,4064,4162,4908,2112,2630,2677,3147,2781,3296,3386,3881,2909,3432,3576,4065,3754,4163,4542,5558,2978,3720,3755,4273,3880,4404,4543,5559,3898,4702,4703,6418,4909,6419,6946,6947,64,65,98,153,99,168,193,300,124,192,215,330,246,355,361,606,125,214,230,354,269,390,441,626,290,440,426,659,487,705,733,1010,152,247,279,406,291,435,465,665,331,485,529,716,589,756,803,1069,360,535,604,767,625,828,851,1116,658,873,915,1228 ,940,1264,1332,1695,169,268,320,484,344,528,588,737,380,605,542,808,645,833,887,1149,434,595,653,872,699,896,935,1244,719,946,1016,1306,1068,1356,1420,1813,479,664,717,934,757,980,1049,1353,822,1056,1103,1392,1151,1449,1522,1930,885,1141,1233,1459,1246,1523,1587,2029,1311,1607,1670,2097,1735,2142,2292,2856,231,301,345,594,391,624,627,886,454,652,702,917,732,963,983,1352,486,703,736,981,802,1048,1100,1396,832,1101,1148,1444,1241,1487,1573,1975,562,754,823,1065,840,1102,1164,1472,916,1229,1247,1527,1310,1606,1633,2096,982,1279,1354,1615,1393,1725,1737,2140,1452,1774,1866,2227,1950,2334,2513,2857,578,829,891,1167,962,1

245,130
9,1613,1011,1328,1358,1694,1421,1736,1812,2211,1
090,1397,1445,1750,1526,1842,1946,2346,1547,1960
,2038,24
32,2114,2522,2604,3163,1163,1473,1538,1869,1624,
1974,2047,2500,1734,2057,2141,2562,2274,2629,276
7,3349,1
811,2180,2293,2714,2322,2837,2921,3435,2509,2946
,3027,3424,3145,3600,3797,4482,278,381,407,698,45
5,704,7
48,1033,464,749,809,1072,842,1150,1204,1571,543,8
20,843,1207,897,1240,1271,1572,941,1270,1333,166
7,1416,1
727,1746,2127,572,890,947,1227,1018,1300,1355,17
26,1064,1370,1424,1748,1448,1836,1891,2320,1057,
1446,147
5,1827,1546,1947,2005,2433,1628,2053,2115,2521,2
151,2603,2741,3299,607,1009,1019,1362,1079,1438,
1474,182
2,1117,1497,1537,1931,1596,2028,2056,2519,1329,1
574,1625,2031,1712,2100,2150,2578,1800,2189,2296
,2712,23
49,2836,2923,3420,1427,1690,1749,2126,1826,2226,
2302,2778,1928,2341,2395,2849,2514,2989,3063,353
5,2039,2
512,2523,3028,2579,3148,3005,3637,2754,3266,3350
,3853,3375,4035,4182,4688,644,1073,1091,1545,130
1,1605,1
632,2052,1363,1666,1713,2119,1775,2191,2295,2782
,1425,1751,1825,2210,1868,2303,2351,2859,1961,23
99,2483,
2985,2563,3031,3162,3657,1570,1837,1890,2350,200
4,2438,2525,3006,2118,2526,2605,3160,2755,3115,3
303,385
5,2215,2696,2810,3267,2904,3374,3422,3942,2990,3
427,3426,4160,3638,4249,4339,4951,1671,1951,2054
,2527,21
90,2628,2740,3217,2297,2779,2838,3351,2945,3385,
3425,4033,2356,2911,3007,3421,3068,3434,3639,425
0,3216,3
723,3768,4346,3890,4526,4642,5283,2520,3029,3154
,3656,3302,3658,3882,4371,3348,3873,3980,4554,41
40,4717,
4924,5486,3408,4066,4186,4779,4302,4927,4829,571
4,4480,4987,5175,5942,5287,6034,6279,6742,321,42
7,478,71
8,534,821,850,1165,563,884,914,1206,961,1266,1278
,1722,573,960,1008,1265,1032,1439,1453,1810,1136,
1458,15
44,1929,1604,2006,2055,2561,579,1017,1078,1447,1
140,1539,1575,1966,1166,1612,1664,2080,1724,2143
,2213,26
36,1232,1691,1739,2188,1823,2294,2335,2764,1843,
2321,2410,2910,2425,2984,3030,3799,755,1137,1162
,1597,12
26,1665,1723,2123,1307,1747,1801,2277,1847,2343,
2398,2808,1359,1809,1889,2323,1965,2424,2435,292
6,2030,2
436,2482,3062,2687,3149,3262,3872,1426,1964,2024
,2479,2099,2524,2560,3112,2149,2686,2749,3207,28
48,3300,
3372,3981,2276,2766,2905,3373,2991,3415,3579,414
1,3153,3582,3724,4251,3769,4369,4540,5281,766,12
05,1267,
1738,1357,1808,1867,2348,1417,1892,1967,2437,204
6,2508,2515,3069,1496,2025,2098,2518,2148,2679,2
715,320
4,2275,2760,2839,3321,2927,3409,3484,3982,1586,2
122,2212,2748,2340,2811,2809,3412,2357,2920,2947
,3472,31
13,3580,3610,4275,2501,3004,3151,3601,3205,3733,
3796,4406,3265,3854,3936,4555,4143,4719,4925,548
7,1629,2
291,2342,2922,2434,2988,3114,3583,2639,3152,3242
,3752,3257,3798,3888,4525,2697,3243,3264,3875,34
13,3897,
4129,4716,3532,4142,4185,4824,4338,4976,5094,575
3,2761,3423,3474,3983,3611,4161,4248,4831,3725,4
336,440
7,4986,4541,5176,5285,5989,3938,4473,4640,5179,4
777,5377,5450,6277,4910,5471,5713,6484,5844,6604
,6741,76
47,841,1308,1371,1893,1486,2007,2081,2602,1536,2
101,2181,2685,2290,2753,2858,3485,1614,2214,2347
,2783,24
11,2987,2944,3534,2439,3026,3144,3722,3218,3734,
3813,4481,1824,2394,2478,2986,2638,3077,3155,375
3,2684,3
219,3259,3852,3301,3889,3941,4690,2698,3298,3384
,3940,3487,4128,4183,4825,3608,4301,4337,4977,44
72,5095,
5210,5940,1846,2637,2678,3206,2699,3256,3320,389
6,2765,3414,3473,4034,3581,4180,4303,4949,3150,3
486,363
6,4184,3726,4347,4474,5092,3891,4475,4641,5208,4
778,5376,5449,6276,3258,3732,3874,4368,3939,4553
,4700,52
80,4131,4718,4827,5448,4948,5484,5752,6487,4187,
4911,4979,5712,5174,5755,5847,6606,5282,5943,603
3,6707,6
226,7077,7079,8155,1888,2713,2752,3475,3076,3578
,3609,4300,3161,3659,3735,4370,3883,4524,4689,52
11,3263,
3812,3937,4527,4032,4701,4828,5379,4181,4926,482
6,5469,5093,5715,5795,6518,3533,3943,4067,4776,4
274,483
0,4978,5556,4345,4984,5173,5792,5209,5845,5990,6
706,4552,5177,5284,5941,5451,6035,6227,6945,5485
,6417,64
86,7233,6605,7432,7434,8152,3727,4130,4344,4985,
4483,5172,5178,5846,4643,5286,5378,6032,5470,622
4,6485,7
078,4691,5468,5557,6416,5794,6516,6517,7433,5988
,6607,6705,7435,6743,7868,7870,10084,4950,5754,5
793,651
9,5991,6704,6740,7645,6225,6944,7076,7869,7234,7

871,9004,10086,6278,7232,7235,8153,7644,8154,9005,10087,7646,9006,9007,10756,10085,10757,10758,10759,128,129,130,199,131,248,251,428,196,250,305,460,336,493,495,782,197,304,306,492,339,538,583,814,386,582,558,869,661,909,957,1274,198,337,385,556,387,581,603,871,461,643,663,928,761,972,1025,1373,494,689,780,975,813,1054,1115,1406,868,1125,1159,1540,1182,1578,1636,2109,249,338,430,642,462,662,760,959,536,781,690,1026,853,1093,1145,1441,580,763,855,1124,881,1156,1181,1554,931,1216,1284,1602,1372,1704,1766,2281,641,870,929,1180,973,1222,1299,1681,1038,1364,1405,1718,1465,1819,1900,2404,1127,1435,1543,1857,1576,1901,2001,2495,1621,2019,2086,2553,2179,2672,2756,3394,307,429,463,762,539,812,815,1144,600,854,882,1179,956,1221,1259,1680,660,883,958,1223,1024,1298,1402,1728,1092,1403,1440,1806,1553,1897,1943,2475,710,970,1039,1367,1094,1404,1476,1858,1178,1541,1577,1903,1620,2018,2051,2552,1258,1595,1682,2035,1719,2139,2185,2632,1830,2230,2338,2735,2412,2834,3023,3395,722,1055,1147,1479,1220,1555,1619,2033,1275,1622,1706,2108,1767,2184,2280,2729,1400,1729,1807,2228,1902,2330,2406,2860,1937,2414,2498,2950,2564,3056,3118,3775,1467,1859,1924,2353,2040,2474,2505,3018,2178,2549,2633,3106,2736,3159,3327,3931,2239,2690,2757,3252,2832,3389,3437,4071,3021,3520,3575,4046,3695,4266,4477,5212,384,537,557,880,601,908,968,1297,602,969,1027,1374,1112,1464,1480,1941,691,1036,1113,1483,1157,1552,1593,1942,1183,1592,1637,2085,1730,2177,2200,2627,720,1146,1217,1501,1286,1600,1683,2176,1366,1716,1768,2204,1818,2326,2361,2814,1365,1816,1861,2325,1936,2407,2485,2951,2042,2507,2565,3039,2689,3117,3255,3879,783,1273,1287,1708,1379,1804,1860,2282,1407,1899,1923,2405,2002,2494,2548,3035,1623,1970,2041,2497,2110,2558,2688,3108,2234,2693,2786,3246,2863,3388,3439,4036,1771,2104,2205,2626,2324,2734,2788,3360,2366,2853,2885,3393,3032,3527,3645,4189,2499,3022,3057,3632,3109,3730,3571,4279,3274,3876,3932,4539,3951,4729,4906,5382,852,1375,1401,1927,1601,2017,2050,2506,1709,2084,2111,2581,2231,2695,2759,3364,1769,2229,2285,2728,2352,2789,2881,3397,2415,2897,3003,3523,3107,3635,3774,4283,1940,2327,2360,2880,2484,2980,3067,3572,2580,3072,3119,3758,3275,3691,3895,4547,2733,3230,3370,3877,3418,3950,4042,4696,3568,4069,4068,4822,4280,4945,5045,5717,2087,2413,2544,3073,2694,3158,3254,3793,2787,3361,3390,3933,3481,3993,4047,4715,2882,3429,3573,4037,3646,4070,4281,4946,3792,4349,4426,5070,4562,5222,5338,6013,3038,3633,3742,4282,3894,4340,4558,5109,3930,4549,4698,5304,4798,5453,5642,6290,3994,4780,4932,5525,4982,5647,5567,6424,5206,5765,5869,6694,6083,6798,6951,7610,431,559,640,930,688,1037,1114,1477,711,1126,1158,1482,1219,1580,1594,2136,721,1218,1272,1579,1296,1805,1831,2238,1432,1856,1926,2367,2016,2488,2545,3105,723,1285,1378,1817,1434,1925,1971,2430,1478,2032,2060,2550,2138,2673,2731,3164,1542,2105,2187,2692,2283,2758,2835,3324,2331,2815,2902,3428,2949,3522,3634,4479,971,1433,1466,2003,1500,2061,2137,2583,1603,2201,2235,2739,2337,2855,2896,3366,1707,2237,2355,2833,2429,2948,2957,3478,2496,2958,3002,3644,3227,3731,3846,4548,1770,2428,2492,2983,2555,3066,3104,3662,2675,3226,3269,3789,3392,3886,3948,4699,2738,3326,3419,3949,3569,3999,4191,4799,3739,4228,4372,4947,4427,5089,5298,5997,974,1481,1581,2186,1705,2236,2339,2862,1731,2364,2431,2959,2504,3020,3033,3647,1898,2493,2554,3034,2674,3221,3253,3784,2737,3278,3391,3929,3479,3995,4166,4712,2000,2582,2730,3268,2852,3371,3367,3996,2883,3436,3521,4134,3663,4226,4276,4953,3019,3570,3737,4267,3785,4403,4476,5110,3851,4546,4574,5305,4821,5465,5643,6291,2043,2747,2854,3438,2956,3526,3690,4229,3167,3738,3840,4422,3843,4478,4560,5221,3231,3841,3850,4557,3997,4569,4793,5452,4176,4820,4923,5560,5044,5744,5802,6431,3279,4043,4164,4713,4277,4823,4944,5573,4373,4988,5111,5764,5299,5912,6021,6721,4608,5169,5308,5919,5483,6085,6138,6949,5584,6237,6421,7112,6574,7332,7527,8275,1095,1618,1717,2365,1896,2489,2551,3116,1922,2559,2691,3223,2746,3273,3396,4167,2034,2732,2861,3365,2903,3525,3480,4188,2981,3574,3694,4348,3794,4418,4485,5207,2284,2884,2982,3524,31 66,3661,3743,4423,3222,3795,3845,4538,3887,4561,
4613,5388,3244,3878,3992,4612,4173,4792,4907,556
1,4270,4
957,4989,5745,5168,5803,5994,6654,2336,3165,3220
,3788,3245,3842,3928,4568,3325,3998,4135,4728,42
27,4854,
4983,5671,3736,4172,4278,4922,4374,5071,5182,576
6,4563,5183,5309,5936,5524,6084,6109,6948,3844,4
402,455
6,5088,4609,5301,5390,5996,4795,5464,5563,6108,5
670,6274,6430,7119,4933,5585,5749,6420,5868,6443
,6651,73
48,6012,6695,6791,7507,6912,7845,7899,8853,2354,
3247,3272,4165,3660,4190,4271,4956,3759,4341,441
9,5108,4
559,5220,5383,5995,3847,4484,4575,5223,4714,5391
,5566,6105,4855,5646,5562,6233,5767,6425,6573,71
86,4177,
4697,4781,5482,4952,5572,5748,6312,5069,5756,584
1,6480,5937,6575,6724,7506,5300,5913,6020,6655,6
139,679
9,6913,7669,6275,7037,7118,8049,7333,8158,8190,8
648,4375,4794,5068,5757,5213,5840,5918,6650,5339
,6082,61
04,6790,6236,6840,7113,7898,5389,6232,6313,7036,
6572,7122,7123,8159,6720,7349,7397,8191,7611,852
4,8562,9
388,5716,6442,6481,7187,6725,7396,7526,8257,6841
,7668,7844,8525,8062,8563,8926,10222,6950,8048,8
063,864
9,8256,8852,8927,10223,8274,9266,9267,11074,9389
,11075,11738,11739,708,709,910,1177,911,1256,137
7,1764,1
052,1376,1443,1862,1582,1939,1969,2682,1053,1442
,1502,1938,1617,2062,2233,2718,1710,2232,2202,27
91,2403,
2901,3001,3614,1176,1583,1639,2106,1711,2207,232
9,2813,1863,2401,2473,2952,2625,3064,3111,3757,1
968,248
7,2680,3075,2717,3224,3271,3848,2790,3277,3399,4
040,3476,4168,4268,4959,1257,1616,1828,2400,1920
,2472,26
24,3017,2048,2681,2490,3156,2745,3229,3347,3901,
2206,2635,2785,3276,2887,3368,3431,4136,2955,348
2,3640,4
230,3756,4296,4424,5205,2363,2812,2953,3430,3065
,3604,3693,4285,3202,3728,3811,4400,3903,4537,46
10,5386,
3345,3893,4045,4551,4138,4611,4783,5569,4255,481
9,4934,5665,5047,5762,5984,6792,1503,1765,1921,2
634,206
3,2716,2719,3346,2286,2784,2898,3417,3000,3531,3
607,4284,2402,2899,3016,3605,3110,3692,3808,4416
,3228,38
09,3900,4520,4133,4571,4733,5527,2546,3058,3203,
3741,3248,3810,3944,4564,3416,4041,4139,4615,425
4,4818,4
921,5664,3606,4179,4286,4851,4401,5041,5065,5760
,4544,5170,5310,5871,5466,6014,6293,6793,2566,32
25,3363,
3947,3530,4137,4253,4849,3615,4264,4298,4958,442
5,5064,5204,5843,3790,4417,4521,5106,4614,5302,5
454,602
2,4695,5480,5574,6140,5718,6318,6428,7291,3935,4
565,4646,5337,4852,5526,5587,6272,5046,5641,5761
,6358,59
14,6441,6711,7509,5203,5800,5985,6602,6010,6785,
6845,7671,6289,6918,7039,7664,7185,7896,8185,889
4,1638,2
049,2107,2886,2287,2900,3036,3689,2328,3037,3157
,3772,3250,3902,3976,4731,2491,3200,3251,3979,33
69,4132,
4175,4732,3477,4174,4269,4931,4420,5043,5090,575
9,2556,3362,3483,4039,3642,4224,4287,5042,3740,4
350,442
8,5104,4536,5296,5343,6008,3729,4522,4567,5219,4
694,5455,5553,6141,4904,5589,5719,6317,5799,6427
,6649,73
99,2683,3613,3643,4342,3787,4486,4566,5214,3849,
4573,4645,5387,4796,5568,5640,6315,4265,4734,485
3,5571,4
980,5668,5798,6422,5180,5805,5992,6600,6037,6784
,6847,7640,4431,4954,5105,5758,5218,5870,5998,67
22,5384,
6017,6087,6789,6294,7013,7115,7843,5575,6292,631
9,7072,6423,7188,7033,7953,6690,7394,7510,8233,7
523,852
3,8566,9188,2744,3773,3791,4693,4225,4817,4920,5
588,4343,4930,4981,5747,5171,5807,5987,6726,4429
,5107,52
17,5842,5336,5999,6039,6795,5481,6107,6239,7009,
6359,7075,7290,7957,4730,5297,5342,6038,5552,623
0,6353,7
034,5746,6354,6429,7288,6691,7127,7439,8235,5867
,6568,6738,7395,6796,7522,7642,8394,7014,7667,76
66,8560,
7954,8645,8771,9519,4935,5467,5590,6355,5806,644
0,6648,7329,5993,6723,6786,7511,6917,7525,7665,8
521,608
0,6843,7035,7641,7116,7670,7955,8646,7328,8051,8
156,8774,8262,8922,9186,9899,6316,7073,7238,7956
,7438,79
58,8258,8851,7508,8237,8396,9002,8532,9269,9512,
10218,7608,8526,8642,9347,8654,9515,9385,10330,8
892,958
3,9671,10506,9903,10754,10863,11486,1829,2203,23
62,2954,2486,3201,3270,3945,2547,3344,3398,3978,
3529,41
70,4178,4990,2557,3528,3612,4169,3688,4487,4545,
5202,3884,4550,4692,5385,4816,5554,5591,6357,256
7,3641,3
786,4523,3892,4647,4735,5522,3946,4848,4928,5644
,5040,5763,5865,6444,4044,4955,5067,5804,5215,59
86,6015,
6708,5303,6009,6110,6842,6137,7008,7074,8187,305
9,3885,3934,4797,4038,4929,4991,5751,4231,5091,5

181,591
7,5307,6019,6106,6736,4299,5201,5341,6011,5521,6136,6143,6914,5570,6228,6238,7114,6515,7189,7350,8236,44
30,5520,5564,6235,5667,6352,6356,7124,5797,6514,6653,7295,6788,7436,7520,8397,5916,6710,6797,7521,7015,7
615,7847,8533,7237,7866,8052,8647,8157,8849,8924,9897,3074,3977,4171,5066,4297,5200,5311,6036,4421,5380,
5523,6229,5586,6288,6295,7117,4572,5565,5666,6314,5796,6483,6603,7292,5915,6692,6787,7505,6915,7609,781
2,8398,4782,5750,5864,6652,6016,6739,6737,7612,6081,6844,6919,7808,7125,7864,7902,8651,6273,7032,7191,78
97,7293,8057,8184,8854,7393,8234,8276,9003,8535,9271,9513,10219,4905,5939,6018,6846,6142,7012,7126,7867,
6447,7236,7334,8060,7345,8186,8260,8921,6569,7335,7392,8239,7613,8273,8529,9268,7840,8534,8641,9348,877
0,9576,9666,10333,6693,7643,7810,8399,7903,8561,8644,9387,8053,8768,8855,9582,8925,9856,9901,10509,8278,
8889,9184,9859,9345,10081,10186,10861,9390,10191,10329,11076,10436,11284,11485,12827,3249,4252,4351,53
81,4570,5555,5645,6426,4644,5669,5801,6513,5938,6689,6794,7813,4850,5866,6023,6727,6111,7011,6916,7842,6
231,7038,7184,8050,7330,8058,8189,8893,5216,6086,6234,7010,6446,7121,7239,8061,6512,7331,7347,8232,7437,
8261,8393,9190,6570,7398,7524,8392,7815,8528,8567,9349,7900,8653,8769,9577,8888,9667,9862,10504,5306,64
45,6482,7294,6571,7344,7504,8272,6709,7614,7809,8522,7865,8564,8655,9517,7190,7814,7952,8640,8054,8775,8
890,9664,8263,8891,9185,9860,9346,10080,10185,10860,7346,8056,8238,8848,8279,9001,9264,9896,8531,9270,9
351,10184,9516,10216,10332,11079,8643,9391,9579,10328,9670,10335,10439,11286,9898,10507,10753,11483,10
858,11741,11743,13771,5340,6601,6688,7811,7120,7846,7901,8652,7289,7959,8059,8850,8259,8920,9189,9863,7
351,8188,8277,8923,8520,9265,9384,10083,8565,9514,9350,10189,9665,10331,10435,11282,7841,8395,8527,9344,
8650,9386,9578,10220,8773,9580,9669,10432,9861,10437,10510,11482,9000,9857,9900,10505,10187,10755,1085
9,11737,10217,11073,11078,11985,11285,11988,11990,13768,8055,8530,8772,9581,8895,9668,9858,10438,9187,9
902,10082,10752,10190,10856,11077,11742,9191,10188,10221,11072,10434,11280,11281,11989,10508,11287,114
81,11991,11487,12828,12830,14280,9518,10334,10433,11283,10511,11480,11484,12825,10857,11736,11740,1282
9,11986,12831,13772,14282,10862,11984,11987,13769,12824,13770,13773,14283,12826,13774,13775,14284,1428
1,14285,14286,14287,256,257,258,263,259,392,395,608,260,394,397,612,496,673,675,1046,261,396,398,672,499,6
78,775,1082,502,774,770,1129,921,1169,1249,1646,262,497,501,768,503,773,859,1131,613,863,923,1172,1041,12
88,1293,1701,674,925,1044,1291,1081,1350,1411,1798,1128,1413,1495,1952,1534,1978,2132,2649,393,498,610,8
62,614,922,1040,1251,676,1045,926,1294,1085,1389,1489,1853,772,1043,1087,1412,1133,1492,1533,1958,1175,1
560,1672,2090,1700,2156,2222,2801,861,1130,1173,1532,1289,1566,1679,2153,1346,1696,1797,2198,1873,2271,2
388,2968,1415,1851,1955,2309,1976,2389,2469,3051,2129,2571,2642,3185,2707,3236,3456,4154,399,609,615,104
2,679,1080,1083,1488,856,1086,1134,1531,1248,1565,1643,2152,920,1135,1250,1567,1292,1678,1794,2216,1388,
1795,1852,2266,1957,2317,2447,3011,986,1254,1347,1699,1390,1796,1876,2310,1530,1953,1977,2391,2128,2570,
2591,3184,1642,2015,2154,2575,2199,2655,2709,3232,2306,2774,2894,3379,2992,3542,3719,4155,990,1351,1491,
1879,1564,1959,2095,2573,1647,2130,2158,2648,2223,2708,2800,3357,1792,2217,2267,2772,2390,2890,2970,354
8,2441,2994,3054,3594,3192,3760,3822,4531,1875,2311,2420,2913,2584,3010,3081,3714,2706,3141,3233,3802,33
80,3859,4079,4723,2799,3314,3457,3988,3540,4149,4257,4895,3717,4292,4363,4890,4499,5098,5293,6092,500,67
7,769,1132,857,1168,1252,1677,858,1253,1295,1702,1408,1872,1880,2445,927,1344,1409,1883,1493,1956,2013,2
446,1535,2012,2133,2641,2218,2705,2720,3215,988,1490,1561,1885,1674,2088,2155,2704,1698,2196,2260,2768,2
270,2842,2917,3538,1697,2268,2313,2841,2440,2971,3013,3595,2586,3083,3193,3751,3313,3821,3991,4619,1047,
1645,1675,2192,1755,2264,2312,2802,1799,2319,2419,2969,2470,3050,3140,3747,2131,2466,2585,3053,2650,319
0,3312,3816,2794,3317,3462,3974,3551,4148,4259,4

880,2263,2644,2769,3214,2840,3378,3464,4088,2962
,3545,35
61,4153,3744,4307,4413,5001,3055,3718,3761,4380,
3817,4506,4319,5115,4026,4616,4768,5371,4803,559
3,5742,6
222,1084,1703,1793,2423,2089,2569,2590,3082,2193
,2640,2651,3209,2775,3319,3459,4092,2261,2773,28
05,3356,
2912,3465,3557,4233,2995,3565,3687,4295,3803,438
3,4530,5119,2444,2843,2916,3556,3012,3680,3767,4
360,320
8,3780,3823,4518,4027,4491,4655,5375,3377,3970,4
146,4617,4238,4802,4886,5532,4316,4893,4892,5722
,5116,57
89,5909,6625,2643,2993,3136,3781,3318,3858,3990,
4585,3463,4089,4150,4769,4289,4809,4891,5583,355
8,4245,4
361,4881,4414,4894,5117,5790,4584,5153,5246,5950
,5406,6114,6214,6933,3750,4381,4514,5118,4654,51
28,5398,
5961,4722,5393,5534,6124,5686,6329,6546,7230,481
0,5672,5780,6389,5890,6555,6451,7400,6046,6697,6
777,767
4,7023,7858,7963,8586,611,771,860,1174,924,1345,1
410,1877,987,1414,1494,1882,1563,1980,2014,2652,
989,156
2,1644,1979,1676,2265,2307,2798,1848,2308,2422,2
963,2568,3044,3137,3801,991,1673,1754,2269,1850,
2421,246
7,2998,1878,2572,2596,3142,2654,3237,3359,3864,1
954,2645,2711,3316,2803,3458,3543,4076,2891,3539
,3586,42
44,3593,4294,4382,5295,1255,1849,1874,2471,1884,
2597,2653,3211,2091,2721,2795,3383,2893,3547,356
4,4094,2
159,2797,2915,3541,2997,3592,3653,4262,3052,3654
,3686,4412,3927,4507,4598,5392,2262,2996,3048,36
83,3187,
3766,3800,4470,3239,3926,4017,4577,4152,4650,480
0,5535,3382,4078,4239,4801,4317,4815,5003,5687,4
511,505
6,5164,5791,5247,5953,6118,6877,1290,1881,1981,2
710,2157,2796,2895,3550,2219,2960,2999,3655,3080
,3716,37
45,4415,2318,3049,3186,3746,3238,3921,3989,4532,
3381,4074,4151,4721,4263,4811,4918,5580,2468,321
0,3358,4
016,3544,4147,4095,4812,3559,4256,4293,4898,4471
,5054,5112,5849,3715,4318,4509,5099,4533,5227,52
92,5962,
4607,5374,5474,6125,5721,6333,6547,7231,2587,340
7,3546,4258,3652,4306,4490,5057,3867,4510,4592,5
242,459
5,5294,5404,6113,3971,4593,4606,5397,4813,5461,5
677,6328,4996,5720,5771,6436,5908,6628,6718,7407
,4075,48
87,4916,5581,5113,5723,5788,6461,5165,5896,5963,
6696,6119,6808,6953,7681,5504,6005,6208,6815,636
3,7081,7
106,7961,6492,7145,7353,8076,7518,8328,8571,9275
,1391,2094,2197,2961,2316,3045,3143,3820,2418,31
91,3315,
3923,3406,4025,4232,4919,2574,3376,3549,4093,358
7,4305,4288,5000,3681,4362,4498,5152,4586,5230,5
333,604
7,2804,3560,3682,4304,3866,4469,4515,5243,3922,4
587,4597,5370,4651,5405,5509,6308,3972,4618,4808
,5508,49
41,5676,5743,6437,5102,5853,5897,6629,6004,6719,
6874,7654,2892,3865,3920,4576,3973,4594,4720,546
0,4077,4
814,4899,5592,5055,5738,5891,6567,4508,4940,5114
,5770,5166,5951,6026,6698,5407,6027,6209,6864,63
88,7080,
7097,7960,4596,5226,5396,5952,5505,6121,6310,687
6,5679,6332,6439,7096,6566,7222,7406,8151,5781,6
493,663
3,7352,6776,7431,7639,8380,6932,7675,7779,8515,7
892,8793,8859,9813,2914,3975,4024,4917,4468,5002
,5103,58
52,4519,5129,5231,5960,5399,6112,6223,6875,4599,
5332,5475,6115,5582,6311,6450,7085,5739,6554,643
8,7141,6
699,7401,7517,8226,4997,5533,5673,6362,5848,6460
,6632,7244,5949,6636,6769,7468,6865,7519,7684,85
14,6120,
6809,6952,7655,7107,7859,7893,8689,7223,8041,815
0,9009,8329,9058,9118,9640,5167,5678,5948,6637,6
093,676
8,6814,7638,6215,7022,7084,7778,7144,7860,8077,8
858,6309,7140,7245,8040,7516,8182,8183,9059,7680
,8381,84
25,9119,8587,9432,9506,10388,6624,7430,7469,8227
,7685,8424,8570,9249,7861,8688,8792,9433,9034,95
07,9926,
11014,7962,9008,9035,9641,9248,9812,9927,11015,9
274,10110,10111,11906,10389,11907,12346,12347,9
84,985,1
170,1529,1171,1640,1753,2220,1348,1752,1855,2314
,1982,2443,2465,3310,1349,1854,1886,2442,2093,25
98,2793,
3354,2194,2792,2722,3467,2967,3585,3685,4378,152
8,1983,2135,2646,2195,2771,2889,3537,2315,2965,3
009,359
6,3213,3764,3819,4517,2464,3015,3308,3783,3353,3
924,4019,4604,3466,4073,4235,4884,4260,4936,5100
,5855,16
41,2092,2304,2964,2416,3008,3212,3713,2588,3309,
3046,3856,3405,3969,4087,4709,2770,3235,3461,407
2,3563,4
144,4247,4900,3599,4290,4408,5058,4516,5124,5244
,6045,2919,3536,3597,4246,3765,4364,4497,5121,38
70,4504,
4591,5224,4711,5369,5506,6306,4085,4653,4889,539
5,4902,5507,5675,6453,5063,5695,5782,6561,5911,6
646,686

8,7784,1887,2221,2417,3234,2599,3352,3355,4086,2806,3460,3566,4237,3684,4315,4367,5120,2966,3567,3712,4365,3818,4496,4588,5228,3968,4589,4708,5364,4897,5463,5597,6391,3138,3762,3871,4513,3984,4590,4772,5440,4236,4885,4903,5511,5062,5694,5769,6560,4366,4999,5122,5727,5225,5901,5945,6644,5372,6006,6210,6779,6334,6934,7241,7785,3194,3925,4091,4775,4314,4901,5061,5725,4379,5096,5126,5854,5245,5944,6044,6771,4578,5229,5365,5958,5510,6122,6330,6954,5531,6360,6462,7128,6626,7250,7404,8251,4771,5441,5514,6213,5736,6390,6495,7220,5910,6545,6645,7338,6810,7429,7679,8541,6043,6716,6869,7530,6922,7709,7889,8691,7229,7922,8043,8680,8225,8856,9109,9882,2134,2589,2647,3562,2807,3584,3748,4489,2888,3749,3857,4528,3986,4710,4804,5595,3047,3868,3987,4807,4145,4896,4943,5596,4261,4942,5101,5779,5240,5903,5954,6639,3188,4090,4291,4883,4410,5052,5123,5902,4512,5154,5288,5956,5368,6116,6219,6920,4505,5366,5443,6099,5530,6331,6397,7129,5740,6525,6627,7249,6703,7403,7637,8427,3311,4377,4411,5130,4535,5334,5442,6094,4605,5473,5513,6307,5684,6452,6544,7247,5097,5598,5737,6455,5888,6564,6702,7354,6024,6733,6872,7528,6957,7708,7891,8676,5291,5850,5957,6638,6098,6778,6878,7682,6304,6941,7083,7777,7242,7989,8079,8783,6463,7240,7251,8044,7355,8228,7997,8917,7658,8386,8542,9133,8559,9379,9590,10096,3404,4529,4579,5529,5053,5693,5768,6524,5131,5778,5889,6631,6007,6735,6871,7686,5289,5959,6097,6770,6212,6879,6959,7787,6361,7087,7147,7985,7339,8047,8250,8969,5594,6117,6218,6958,6396,7134,7253,7998,6630,7254,7405,8248,7659,8203,8431,9135,6775,7512,7698,8387,7856,8558,8678,9294,7990,8683,8682,9504,8918,9625,9707,10415,5783,6335,6526,7255,6734,7428,7636,8281,6873,7683,7710,8543,7921,8569,8681,9377,7020,7863,7999,8677,8148,8690,8919,9626,8280,9011,9056,9746,9258,9894,10090,10763,7248,8045,8242,8968,8430,8970,9250,9755,8540,9193,9364,9970,9500,10133,10396,10950,8584,9434,9594,10179,9702,10399,10301,11178,9880,10475,10591,11406,10767,11530,11767,12166,2305,2723,2918,3598,3014,3869,4018,4773,3139,4084,4234,4806,4313,4938,4998,5898,3189,4312,4376,4937,4488,5335,5373,6042,4648,5394,5528,6305,5692,6398,6527,7337,3195,4409,4534,5367,4652,5515,5599,6366,4774,5724,5776,6552,5900,6647,6773,7460,4888,5851,5947,6732,6095,6870,6935,7676,6123,6921,7098,7862,7105,7984,8046,9111,3763,4649,4770,5685,4882,5777,5899,6635,5059,5955,6025,6813,6127,6943,7086,7696,5127,6041,6217,6923,6365,7104,7131,7894,6454,7132,7146,8078,7479,8229,8382,9192,5290,6364,6448,7143,6563,7252,7336,8200,6701,7478,7653,8271,7776,8428,8556,9365,6812,7678,7857,8557,7991,8591,8795,9501,8241,8798,9012,9627,9057,9753,9924,10761,3782,4805,4939,5946,5125,6040,6211,6956,5241,6220,6367,7133,6494,7228,7243,8149,5472,6449,6562,7246,6700,7471,7531,8268,6811,7672,7711,8513,7895,8585,8724,9366,5674,6634,6772,7652,6940,7699,7697,8588,7021,7888,7923,8696,8201,8796,8882,9643,7221,7996,8231,8857,8269,9021,9108,9814,8385,9134,9288,9971,9503,10135,10397,10951,5741,6867,6942,7890,7130,7988,8202,8799,7463,8240,8330,9032,8377,9110,9256,9893,7513,8331,8384,9195,8589,9273,9489,10132,8780,9502,9593,10296,9706,10464,10574,11209,7673,8679,8698,9367,8883,9505,9624,10303,9013,9704,9815,10474,9925,10640,10765,11445,9290,9873,10088,10643,10177,10841,10930,11765,10390,10943,11177,11932,11364,12028,12165,12767,3985,5060,5155,6221,5462,6399,6553,7402,5512,6565,6717,7477,6866,7657,7786,8725,5726,6774,6955,7687,7099,7987,7920,8782,7135,8042,8224,9010,8282,9022,9117,9881,6096,7082,7142,7986,7462,8181,8243,9033,7476,8283,8379,9132,8429,9257,9293,10098,7514,8426,8568,9292,8727,9488,9591,10297,8880,9701,9705,10465,9872,10575,10690,11404,6126,7461,7470,8270,7515,8376,8512,9272,7677,8590,8697,9378,8797,9588,9703,10413,8230,8726,8916,9592,9014,9747,9874,10572,9259,9875,10089,10688,10178,10840,10929,11764,8378,9020,9194,9752,9291,9969,10108,10760,9491,10134,10299,10928,10412,10948,11208,11935,9595,10391,10467,11176,10590,11211,11367,12030,10762,11407,11529,12131,11690,12421,12423,13211,6216,7529,7656,8699,8180,8794,8881,9700,8249,8971,9023,9754,9251,9892,10097,10691,8383,9116,9289,

9895,9376,10109,10300,10843,9589,10398,10298,10941,10573,11179,11243,11998,8781,9295,9435,10176,9642,10302,10466,11012,9745,10472,10589,11240,10689,11365,11446,12130,9968,10641,10764,11405,10931,11531,11691,12345,10949,11905,11934,12497,12029,12680,12682,13208,9015,9490,9744,10473,9883,10588,10642,11366,10091,10766,10842,11528,10942,11688,11933,12422,10099,10940,11013,11904,11242,11996,11997,12681,11444,12031,12129,12683,12167,13060,13062,14500,10414,11210,11241,11999,11447,12128,12164,12765,11689,12344,12420,13061,12498,13063,13916,14502,11766,12496,12499,13209,12764,13210,13917,14503,12766,13918,13919,14932,14501,14933,14934,14935,1384,1385,1386,1759,1387,2008,2011,2724,1756,2010,2257,2844,2384,2973,2975,3806,1757,2256,2258,2972,2387,3042,3199,3862,2594,3198,3086,4029,3469,4157,4309,4994,1758,2385,2593,3084,2595,3197,3307,4031,2845,3403,3471,4240,3777,4356,4465,5157,2974,3553,3804,4359,3861,4502,4603,5238,4028,4621,4727,5516,4790,5634,5772,6597,2009,2386,2726,3402,2846,3470,3776,4311,3040,3805,3554,4466,4021,4581,4705,5361,3196,3779,4023,4620,4081,4724,4789,5578,4243,4856,5004,5690,5156,5856,5966,6833,3401,4030,4241,4788,4357,4862,5051,5785,4494,5132,5237,5894,5401,6091,6284,7092,4623,5331,5519,6129,5632,6285,6393,7199,5733,6435,6558,7281,6715,7464,7660,8578,2259,2725,2847,3778,3043,3860,3863,4704,3304,4022,4082,4787,4308,4861,4915,5784,3468,4083,4310,4863,4464,5050,5234,5904,4580,5235,5360,6030,5577,6281,6327,7139,3590,4354,4495,5135,4582,5236,5444,6130,4786,5517,5633,6287,5732,6434,6523,7280,4914,5683,5786,6459,5895,6643,6729,7456,6102,6782,6938,7607,7100,7706,8039,8579,3650,4503,4707,5447,4860,5579,5731,6457,4995,5734,5858,6596,5967,6728,6832,7601,5232,5905,6031,6780,6286,6930,7094,7788,6321,7102,7218,7926,7340,8072,8206,9063,5403,6131,6300,7017,6488,7138,7225,8034,6714,7261,7457,8194,7632,8247,8519,9283,6807,7482,7661,8372,7704,8573,8693,9439,8037,8728,8791,9430,8999,9634,9877,10692,2592,3041,3085,4080,3305,4156,4352,5049,3306,4353,4467,5158,4600,5400,5456,6325,3555,4492,4601,5459,4725,5576,5681,6326,4791,5680,5773,6557,5906,6713,6744,7427,3648,4706,4857,5477,5006,5688,5787,6712,5134,5892,6000,6748,6090,6926,7025,7702,5133,6088,6133,6925,6320,7095,7149,7927,6490,7227,7341,8071,7481,8205,8375,9199,3807,4993,5007,5860,5163,6028,6132,6834,5239,6283,6299,7093,6394,7198,7260,8067,5735,6386,6489,7217,6598,7286,7480,8196,6802,7485,7690,8334,7791,8572,8695,9380,6003,6592,6749,7426,6924,7606,7692,8544,7030,7781,7821,8577,8064,8735,8965,9597,7219,8038,8073,8912,8197,9018,8787,9647,8418,9196,9284,9923,9359,10137,10386,10846,4020,5159,5233,6303,5689,6433,6522,7226,5861,6556,6599,7357,6783,7487,7663,8548,6001,6781,6837,7600,7016,7693,7817,8581,7103,7849,7995,8731,8195,8915,9062,9675,6324,6927,7024,7816,7148,7964,8147,8788,7356,8176,8207,9038,8419,8995,9263,9931,7605,8326,8554,9197,8674,9358,9426,10104,8784,9437,9436,10294,9672,10409,10501,11181,6559,7101,7256,8177,7486,8246,8374,9105,7691,8545,8574,9285,8721,9369,9431,10131,7818,8685,8789,9381,8966,9438,9673,10410,9104,9749,9866,10566,9978,10702,10834,11477,8070,8913,9030,9674,9262,9708,9974,10581,9282,9933,10106,10792,10214,10933,11162,11770,9370,10180,10404,10957,10470,11167,11023,11912,10654,11237,11373,12094,11651,12278,12351,12754,2727,3087,3400,4242,3552,4493,4602,5445,3591,4622,4726,5458,4859,5636,5682,6640,3649,4858,4992,5635,5048,6029,6103,6806,5328,6128,6302,7031,6432,7192,7257,8193,3651,5005,5162,6089,5330,6301,6387,7110,5446,6456,6548,7262,6642,7465,7603,8252,5518,6593,6731,7484,6835,7662,7707,8516,6931,7703,7854,8684,7925,8730,8914,9879,4355,5329,5402,6395,5476,6549,6641,7359,5691,6745,6803,7635,6937,7783,7848,8550,5859,6805,7019,7705,7109,7924,7933,8702,7216,7934,7994,8964,8323,9019,9126,9932,6002,7108,7196,7967,7283,8146,8192,8974,7467,8322,8389,9069,8576,9254,9356,10107,7634,8518,8675,9357,8785,9375,9599,10215,9027,9620,9756,10411,9867,10569,10786,11453,4358,5457,5637,6730,5857,6804,6939,7790,5907,7028,7111,7935,7224,8036,8065,8967,6282,7197,7282,806

6,7466,8285,8373,9064,7633,8422,8575,9281,8703,9
371,951
0,10128,6392,7358,7602,8388,7780,8555,8551,9372,
7819,8692,8729,9494,8975,9618,9644,10441,8035,87
86,9025,
9635,9065,9811,9876,10582,9131,9930,10022,10793,
10293,10937,11163,11771,6491,7651,7782,8694,793
2,8734,8
994,9621,8255,9026,9120,9822,9123,9878,9976,1070
1,8327,9121,9130,9973,9373,10017,10209,10932,958
4,10292,
10395,11016,10500,11200,11290,11919,8423,9427,9
508,10129,9645,10295,10408,11085,9757,10476,105
83,1123
6,10787,11392,11525,12137,10024,10585,10796,113
99,10947,11653,11682,12349,11152,11733,11909,12
424,1202
2,12612,12735,13339,4583,5730,5893,7029,6280,719
3,7263,8204,6298,7287,7483,8287,7650,8417,8580,9
511,645
8,7604,7789,8549,7855,8733,8720,9596,7965,8790,8
998,9748,9106,9818,9885,10655,6836,7820,7966,873
2,8254,8
973,9031,9823,8286,9107,9125,9922,9255,9977,1002
9,10852,8332,9198,9368,10028,9573,10208,10387,11
017,963
8,10445,10477,11201,10584,11291,11450,12086,693
6,8253,8284,9068,8333,9122,9280,10016,8517,9374,
9495,101
36,9619,10326,10471,11175,9024,9572,9646,10394,9
758,10567,10646,11238,9979,10647,10797,11400,10
956,116
52,11661,12348,9124,9810,9972,10568,10025,10789,
10854,11452,10211,10936,11019,11660,11174,11762
,11918,1
2431,10405,11153,11205,11908,11372,11923,12083,
12620,11476,12095,12175,12723,12336,13005,13067
,13877,7
018,8335,8416,9509,8972,9598,9639,10444,9039,970
9,9819,10580,9975,10700,10847,11451,9127,9884,10
023,107
03,10130,10855,11022,11657,10327,11166,11018,11
729,11239,11913,12021,12490,9585,10105,10181,10
946,1044 0, 11084,11204,11808,10565,11212,11361,
11928,11401,12023,12140,12722,10788,11393,
11524,12087,11683,1227
9,12337,12821,11763,12365,12430,13129,12613,132
14,13302,13656,9759,10210,10564,11213,10693,113
60,11398,
12082,10835,11650,11656,12174,11732,12280,12425
,13066,10853,11728,11809,12364,12020,12482,1248
3,13215,
12136,12621,12677,13303,12755,13452,13578,14060
,11180,11922,11929,12491,12141,12676,12734,1332
9,12281,
12820,13004,13453,13206,13579,13910,14662,12350
,13128,13207,13657,13328,13876,13911,14663,1333
8,13978,
13979,15074,14061,15075,15578,15579,3588,3589,4
158,4785,4159,4912,5161,5964,4500,5160,5363,6134
,5638,6,
323,6385,7474,4501,5362,5478,6322,5729,6550,6801
,7534,5862,6800,6746,7695,7091,7853,7993,8886,47
84,5639,
5775,6594,5863,6751,6929,7701,6135,7089,7137,792
8,7425,8144,8199,9037,6384,7151,7472,8179,7533,8
320,839
1,9128,7694,8421,8583,9424,8700,9568,9636,10447,
4913,5728,6100,7088,6296,7136,7424,8033,6520,747
3,7194,8
244,7649,8325,8539,9277,6750,7459,7689,8420,7823
,8552,8687,9496,7931,8722,8960,9622,9036,9696,98
64,1065
3,7027,7700,7929,8686,8145,8860,8997,9677,8266,9
016,9115,9808,9279,9921,10026,10850,8537,9261,94
29,9935,
9498,10027,10183,11081,9631,10291,10406,11169,1
0503,11234,11440,12272,5479,5965,6297,7458,6551,
7532,75
35,8538,6838,7688,7850,8673,7992,8779,8863,9676,
7090,7851,8032,8861,8198,8996,9112,9816,8324,911
3,9276,9
888,9493,10019,10141,10959,7258,8074,8267,9029,8
368,9114,9352,9980,8672,9425,9499,10031,9630,102
90,1039
3,11168,8862,9587,9678,10323,9809,10497,10561,11
232,9928,10586,10798,11375,10938,11478,11773,12
273,734
2,8321,8547,9355,8778,9497,9629,10321,8887,9632,
9698,10446,9865,10560,10652,11363,9070,9817,988
9,10578,
10030,10790,10934,11526,10103,10944,11086,11684
,11182,11814,11916,12507,9287,9981,10094,10833,1
0324,10
958,11155,11760,10502,11161,11233,11822,11394,1
1921,12135,12725,10651,11288,11441,12026,11474,
12169,12
285,12823,11769,12342,12367,12816,12489,13064,1
3297,13886,5774,6521,6595,7822,6839,7852,8068,89
93,6928,
8069,8245,9060,8370,9278,9360,10139,7195,8264,83
71,9363,8553,9492,9575,10140,8701,9574,9637,1040
3,9820,
10499,10570,11215,7284,8546,8723,9383,8962,9616,
9679,10498,9028,9750,9868,10576,9920,10784,1083
9,11472,
9017,9890,9983,10699,10102,10935,11009,11685,10
384,11157,11183,11813,11247,11915,12081,12679,7
475,8885,
8963,9710,9067,9886,9982,10694,9129,10021,10093,
10851,10212,11080,11160,11811,9633,10142,10325,
11083,1
0468,11172,11246,11910,10644,11293,11448,12024,
11533,12168,12287,12760,9871,10442,10577,11214,
10698,11
374,11454,12138,10848,11521,11655,12173,11774,1

2357,12427,13003,11087,11772,11815,12416,11911,12492,12361,13121,12090,12674,12726,13305,12731,13451,13582,13972,7648,9061,9071,10101,9617,10289,10392,11156,9711,10402,10469,11203,10587,11295,11443,12142,9869,10579,10697,11362,10832,11455,11535,12275,10945,11659,11735,12353,11823,12419,12506,13125,10138,10785,10838,11534,11008,11694,11817,12362,11202,11818,11917,12504,12091,12487,12687,13307,11371,12016,12162,12675,12276,12730,12762,13442,12358,12819,12818,13576,13122,13653,13763,14135,10407,10939,11158,11819,11294,11920,12080,12609,11449,12139,12170,12727,12341,12733,12817,13449,11648,12283,12363,12761,12428,12822,13123,13654,12608,13131,13212,13766,13334,13906,13970,14395,11812,12417,12502,13124,12686,13126,13330,13875,12724,13309,13444,13914,13572,13981,14128,14658,12752,13454,13650,14051,13662,14131,14057,14666,13884,14143,14279,14810,14399,14930,14943,15574,6101,6747,7026,7930,7150,8265,8390,9353,7259,8536,8582,9362,8777,9570,9586,10478,7285,8776,8884,9569,8992,9887,9929,10650,9252,9934,10100,10849,10288,11010,11159,11821,7343,8961,9066,9891,9260,10095,10143,10954,9354,10320,10400,11164,10496,11235,11369,11924,9428,10443,10563,11292,10695,11442,11479,12132,10791,11473,11662,12282,11681,12352,12418,13299,8075,9253,9286,10213,9382,10401,10479,11207,9623,10571,10645,11397,10795,11523,11658,12160,9699,10649,10837,11475,10953,11680,11687,12338,11082,11692,11734,12426,11995,12493,12622,13308,9870,10952,11020,11731,11171,11816,11820,12484,11245,11994,12085,12511,12172,12684,12728,13445,11396,12134,12277,12729,12359,12759,13007,13573,12501,13058,13132,13655,13213,13873,13908,14393,8178,9361,9571,10562,9697,10648,10799,11532,9821,10844,10955,11693,11154,11768,11775,12429,10020,11021,11170,11810,11244,11931,12027,12508,11395,12092,12171,12721,12339,12753,12996,13446,10182,11206,11368,12084,11520,12163,12161,12756,11649,12284,12343,12992,12485,13056,13070,13659,11761,12360,12495,13065,12509,13201,13296,13878,12673,13306,13340,13915,13575,13983,14129,14659,10385,11403,11522,12286,11686,12356,12486,13059,11927,12500,12614,13204,12617,13298,13332,13905,12017,12615,12672,13311,12757,13337,13569,13980,13000,13574,13649,14052,13762,14136,14274,14669,12093,12763,12994,13447,13071,13577,13652,14059,13133,13760,13879,14142,13909,14384,14397,14813,13342,13881,13968,14387,14049,14497,14506,14941,14062,14511,14665,15076,14804,15084,15573,15899,8369,9628,9751,10845,10018,11011,11165,11914,10092,11173,11289,11993,11402,12089,12274,12997,10322,11370,11527,12143,11663,12355,12340,13002,11695,12366,12488,13130,12610,13202,13301,13885,10696,11654,11730,12354,11926,12481,12503,13205,11992,12611,12619,13304,12685,13333,13441,13974,12018,12678,12732,13440,12999,13568,13583,14053,13068,13661,13761,14137,13880,14275,14390,14808,10794,11925,11930,12510,12019,12616,12720,13336,12133,12758,12993,13450,13057,13580,13663,14133,12494,12998,13120,13648,13134,13767,13882,14272,13335,13883,13969,14388,14050,14496,14505,14940,12618,13200,13310,13872,13343,13913,13976,14392,13571,13982,14055,14504,14132,14656,14668,15079,13651,14063,14139,14664,14278,14671,14807,15086,14394,14811,14929,15571,14938,15581,15583,16083,10836,12025,12088,12995,12480,13006,13069,13660,12505,13127,13203,13874,13331,13904,13973,14391,12623,13300,13341,13907,13448,13977,14056,14499,13581,14130,14054,14509,14273,14667,14803,15082,13001,13443,13455,14048,13658,14058,14138,14660,13765,14140,14277,14800,14389,14805,14814,15570,13912,14385,14396,14809,14507,14931,14939,15577,14657,15073,15078,15889,15085,15892,15894,16080,13135,13570,13764,14141,13887,14276,14386,14806,13971,14398,14498,14928,14510,14936,15077,15582,13975,14508,14661,15072,14802,15080,15081,15893,14812,15087,15569,15895,15575,15900,15902,16088,14134,14670,14801,15083,14815,15568,15572,15897,14937,15576,15580,15901,15890,15903,16084,16090,14942,15888,15891,16081,15896,16082,16085,16091,15898,16086,16087,16092,16089,16093,16094,16095,512,513,514,519,515,520,523,792,516, 522,525,796,784,993,995,1326,517,524,526,992,787,998,1007,1506,790,1006,1002,1513,1193,1649,1657,2078,518,785,789,1000,791,1005,1187,1515,797,1191,1195,1652,1321,1776,1781,2173,994,1197,1324,1779,1505,1790,1915,2254,1512,1917,1991,2456,1998,2530,2660,3337,521,786,794,1190,798,1194,1320,1659,996,1325,1198,1782,1509,1909,1985,2373,1004,1323,1511,1916,1517,1988,1997,2462,1655,2064,2160,2618,2172,2668,2830,3505,1189,1514,1653,1996,1777,2070,2167,2665,1786,2168,2253,2822,2377,2879,3092,3672,1919,2371,2459,2933,2528,3093,3133,3907,2657,3171,3330,3961,3443,4052,4200,5034,527,793,799,1322,999,1504,1507,1984,1184,1510,1518,1995,1656,2069,2075,2664,1192,1519,1658,2071,1780,2166,2250,2824,1908,2251,2372,2874,2461,2941,3127,3827,1314,1662,1787,2171,1910,2252,2380,2934,1994,2457,2529,3095,2656,3170,3183,3960,2074,2543,2666,3175,2823,3343,3445,4048,2930,3494,3622,4123,3704,4222,4631,5035,1318,1791,1987,2383,2068,2463,2623,3173,2079,2658,2670,3336,2831,3444,3504,4117,2248,2825,2875,3492,3094,3618,3674,4332,3121,3706,3910,4442,4000,4656,4742,5491,2379,2935,3100,3625,3176,3826,3913,4626,3442,3957,4049,4682,4124,4747,4975,5699,3503,4106,4201,4844,4220,5029,5145,5927,4629,5188,5267,5922,5419,6162,6373,7212,788,997,1001,1516,1185,1648,1660,2165,1186,1661,1783,2174,1912,2376,2448,3125,1199,1784,1913,2451,1989,2460,2541,3126,1999,2540,2661,3329,2826,3441,3448,4015,1316,1986,2065,2453,2162,2616,2667,3440,2170,2820,2868,3488,2878,3514,3629,4218,2169,2876,2937,3513,3120,3675,3829,4443,3178,3915,4001,4639,4105,4741,4847,5619,1327,2077,2163,2816,2243,2872,2936,3506,2255,2943,3099,3673,3134,3906,3956,4635,2659,3130,3177,3909,3338,3966,4104,4736,3498,4109,4206,4838,4335,5028,5147,5880,2871,3332,3489,4014,3512,4122,4208,5016,3666,4329,4393,5033,4632,5195,5325,6065,3911,4630,4657,5316,4737,5426,5255,6171,4962,5616,5704,6411,5827,6673,6862,7382,1508,2175,2249,3103,2617,3169,3182,3914,2817,3328,3339,4009,3495,4111,4203,5020,2869,3493,3509,4116,3624,4209,4389,5073,3707,4397,4463,5191,4683,5319,5490,6175,3124,3515,3628,4388,3828,4456,4663,5264,4008,4668,4743,5438,4963,5355,5655,6415,4121,4834,5026,5617,5078,5826,5886,6620,5252,5925,5924,6826,6172,6965,7045,7745,3331,3705,3952,4669,4110,4746,4846,5545,4207,5017,5030,5705,5185,5833,5923,6663,4390,5141,5265,5881,5326,5926,6173,6966,5544,6201,6350,7054,6478,7274,7326,8109,4638,5317,5434,6174,5654,6192,6470,7153,5698,6465,6622,7300,6766,7449,7626,8414,5834,6752,6900,7541,6994,7715,7579,8504,7206,7793,7937,8810,8135,8986,9139,9762,795,1003,1188,1654,1196,1785,1914,2381,1315,1918,1990,2450,2067,2532,2542,3340,1317,2066,2076,2531,2164,2873,2931,3502,2368,2932,3102,3667,3168,3836,3953,4681,1319,2161,2242,2877,2370,3101,3131,3710,2382,3172,3284,3958,3342,4053,4119,4752,2458,3333,3447,4108,3507,4202,4223,4972,3619,4219,4434,5140,4441,5190,5318,6375,1663,2369,2378,3135,2452,3285,3341,4011,2619,3449,3499,4127,3621,4331,4396,5022,2671,3501,3627,4221,3709,4440,4453,5150,3908,4454,4462,5324,4767,5427,5606,6464,2870,3708,3904,4459,3963,4662,4680,5350,4055,4766,4865,5537,5032,5650,5824,6623,4126,4974,5079,5825,5253,5839,6067,6767,5431,6152,6244,6967,6351,7057,7278,8029,1778,2449,2533,3446,2669,3500,3623,4334,2827,3664,3711,4455,3912,4628,4633,5327,2942,3905,3962,4634,4054,4761,4845,5492,4125,4970,5031,5697,5151,5835,5982,6660,3132,4010,4118,4864,4328,5027,5023,5836,4391,5144,5189,5930,5351,6150,6168,6969,4627,5254,5429,6163,5493,6259,6372,7154,5615,6414,6538,7301,6825,7453,7627,8415,3179,4199,4330,5146,4452,5194,5354,6153,4755,5430,5600,6346,5603,6374,6476,7273,4835,5601,5614,6469,5837,6509,6757,7448,6060,6824,6883,7572,7044,7748,7830,8511,4971,5887,5980,6661,6169,6827,6964,7589,6245,7000,7155,7792,7279,8000,8121,8825,6576,7165,7320,8007,7499,8169,8298,9137,7596,8353,8481,9236,8670,9480,9723,10363,1911,2622,2821,3665,2940,3837,3959,4740,3098,3967,4107,4763,4198,4961,5072,5983,3174,4120,4333,5021,4435,5193,5184,6064,4457,5266,5418,6200,5546,6262,6381,7207,3508,4392,4458,5192,4754,5349,5435,6347,4762,5547,5605,6410,5651,6477,6581,7420,4836,5618,5832,6580,6053,6756,6863,75

73,6166,
6973,7001,7749,7164,7831,8026,8766,3620,4753,476
0,5536,4837,5602,5696,6508,4973,5838,5931,6672,6
151,685
8,6995,7735,5428,6052,6170,6882,6246,7055,7178,7
794,6479,7179,7321,8016,7540,8168,8217,9136,5604
,6258,64
68,7056,6577,7297,7422,8028,6759,7452,7575,8216,
7734,8406,8510,9247,6901,7597,7753,8480,7936,859
9,8759,9
532,8108,8811,8931,9611,9052,9961,10003,10917,36
26,4839,4960,5981,5348,6066,6167,6972,5439,6193,
6263,71
52,6471,7272,7383,8027,5607,6380,6539,7275,6662,
7423,7578,8173,6859,7714,7574,8349,7795,8505,866
9,9338,6
061,6621,6753,7498,6968,7588,7752,8436,7053,7756
,7905,8628,8017,8671,8828,9610,7296,8001,8120,87
67,8299,
8987,9053,9785,8407,9201,9246,10121,9481,10202,1
0262,10768,6247,6758,7052,7757,7213,7904,8006,87
58,7327,
8134,8172,8930,8352,8988,9237,10002,7421,8348,84
37,9200,8668,9302,9303,10203,8824,9533,9553,1026
3,9763,
10544,10658,11468,7744,8598,8629,9339,8829,9552,
9722,10345,8989,9784,9960,10545,10170,10659,110
70,1207
0,9138,10120,10171,10769,10344,10916,11071,1207
1,10362,11262,11263,12834,11469,12835,13234,132
35,1312,
1313,1650,1993,1651,2072,2241,2828,1788,2240,237
5,2938,2534,3123,3129,4062,1789,2374,2454,3122,2
621,328
6,3497,4114,2818,3496,3450,4211,3671,4433,4461,5
314,1992,2535,2663,3334,2819,3491,3617,4217,2939
,3669,38
25,4444,4013,4660,4739,5437,3128,3831,4060,4671,
4113,4764,4867,5612,4210,4969,5075,5884,5148,604
8,6164,6
975,2073,2620,2928,3668,3096,3824,4012,4625,3180
,4061,3838,4744,4197,4833,5015,5661,3490,4051,42
05,4968,
4395,5024,5143,5932,4447,5186,5320,6154,5436,618
8,6348,7205,3631,4216,4445,5142,4661,5268,5417,6
185,475
8,5424,5551,6256,5663,6409,6578,7418,5013,5653,5
921,6467,5934,6579,6755,7581,6159,6823,6902,7729
,7047,77
74,8020,8936,2455,2829,3097,4050,3287,4112,4115,
5014,3510,4204,4398,5077,4460,5251,5271,6184,367
0,4399,4
624,5269,4738,5416,5548,6260,4832,5549,5660,6404
,5929,6511,6677,7543,3954,4658,4759,5433,4840,55
50,5708,
6496,5076,5885,5935,6583,6158,6822,6881,7728,527
0,6063,6186,6831,6257,7005,7049,7772,6412,7166,7
322,793
9,7454,8110,8433,8937,4002,4765,5019,5711,5250,5
933,6157,6829,5315,6160,6190,6974,6349,7048,7204
,7907,55
38,6261,6405,7062,6582,7298,7450,8122,6619,7496,
7590,8304,7746,8442,8508,9403,5707,6497,6610,732
5,6856,7
542,7599,8404,7046,7625,7773,8466,8002,8597,8815
,9653,7203,7828,8021,8714,8098,8901,9049,9787,84
13,9074,
9203,9776,9337,10000,10245,10994,2662,3181,3335,
4394,3511,4432,4636,5353,3616,4637,4745,5488,484
2,5662,
5828,6675,3839,4756,4843,5831,5025,5928,6055,667
6,5149,6054,6165,6899,6344,7007,7058,7759,3964,5
018,518
7,5883,5322,6148,6187,7006,5432,6202,6368,7060,6
408,7276,7379,8096,5425,6406,6499,7267,6618,7451
,7557,83
05,6860,7621,7747,8441,7799,8507,8757,9555,4063,
5313,5323,6194,5495,6382,6498,7214,5613,6537,660
9,7419,6
764,7580,7624,8439,6161,6678,6857,7583,6992,7732
,7798,8482,7176,7837,8024,8712,8125,8900,9051,97
72,6371,
6970,7061,7758,7266,7938,8030,8826,7416,8117,817
1,8929,8434,9149,9239,9855,7591,8432,8443,9204,8
483,934
0,9165,10037,8802,9538,9654,10285,9695,10531,106
78,11248,4196,5489,5539,6617,6149,6821,6880,7620
,6195,6
898,6993,7751,7167,7839,8023,8830,6369,7063,7265
,7906,7324,8031,8127,8939,7497,8175,8355,9145,84
67,9207,
9402,10057,6674,7277,7378,8126,7556,8310,8445,91
66,7750,8446,8509,9400,8803,9323,9559,10287,7911
,8664,8
874,9539,8984,9694,9774,10422,9150,9779,9778,106
56,10038,10729,10867,11543,6903,7455,7622,8447,7
838,859
6,8756,9457,8025,8827,8902,9655,9073,9721,9777,1
0529,8132,8991,9167,9773,9244,9786,10039,10730,9
456,101
23,10200,10874,10354,11054,11218,11827,8440,920
5,9394,10056,9558,10058,10346,10899,9652,10337,1
0460,11
098,10620,11277,11500,12014,9760,10546,10682,11
323,10814,11503,11389,12210,10992,11563,11719,1
2438,118
31,12546,12695,13078,2929,3451,3630,4446,3830,47
57,4866,5709,3955,5012,5074,5830,5249,6050,6062,
7002,39
65,5248,5312,6049,5352,6383,6413,7202,5648,6466,
6616,7417,6820,7558,7623,8465,4003,5321,5494,640
7,5652,6
611,6679,7502,5710,6828,6896,7712,7004,7775,7909
,8604,5920,6971,7051,7836,7215,8022,8111,8812,72
99,8097,
8218,8990,8297,9144,9206,10247,4659,5649,5706,67

65,5882,6897,7003,7755,6155,7059,7177,8005,7303,
8119,81
74,8872,6191,7201,7377,8099,7501,8296,8307,9054,
7582,8308,8354,9238,8639,9341,9534,10336,6370,75
00,7576,
8351,7731,8444,8464,9320,7797,8638,8765,9447,892
8,9556,9692,10461,8004,8814,8985,9693,9151,9767,
9963,10
621,9393,9966,10124,10731,10201,10897,11068,118
25,4670,5829,6051,7050,6189,7200,7323,8124,6345,
7380,750
3,8309,7598,8412,8435,9245,6536,7577,7730,8438,7
796,8631,8715,9444,8003,8808,8903,9609,9055,9761
,9836,10
462,6754,7754,7908,8764,8116,8875,8873,9764,8133
,9048,9075,9824,9321,9964,10010,10771,8405,9164,
9343,10
001,9445,10149,10244,10918,9537,10286,10416,110
99,10623,11279,11501,12015,6861,8019,8118,9050,8
306,914
8,9322,9967,8607,9392,9482,10168,9529,10246,1035
2,11053,8665,9483,9536,10339,9765,10361,10609,11
276,985
2,10622,10681,11384,10866,11552,11622,12249,880
9,9775,9826,10463,10011,10657,10728,11391,10125,
10864,1
0919,11562,11069,11720,11829,12469,10418,10985,
11216,11723,11321,11889,11962,12693,11470,11983
,12209,1
2884,12324,12956,13077,13679,4841,6156,6203,738
1,6510,7559,7713,8506,6608,7733,7829,8637,8018,8
801,8938,
9837,6830,7910,8123,8831,8219,9147,9072,9854,831
1,9202,9336,10122,9458,10150,10261,10993,7264,81
70,835
0,9146,8606,9301,9395,10169,8636,9459,9531,10284
,9557,10353,10421,11250,8666,9554,9720,10420,983
9,10608,
10679,11385,10008,10813,10865,11553,10984,11623
,11754,12436,7302,8605,8630,9446,8667,9528,9608,
10360,8
813,9766,9825,10530,9965,10676,10815,11541,9342,
9838,10036,10680,10126,10875,10986,11620,10355,
10987,1
1217,11752,11322,11888,11961,12692,9530,10148,1
0338,10896,10419,11097,11260,11824,10611,11278,
11387,11
960,11540,12012,12248,12887,10683,11471,11555,1
2208,11718,12251,12327,12958,11826,12439,12545,
13027,12
658,13285,13287,13995,7376,8713,8800,9827,9300,9
962,10009,10812,9401,10059,10151,10898,10347,11
052,112
49,11755,9535,10260,10417,11055,10528,11261,113
88,11891,10677,11502,11386,11981,11621,12211,12
307,1290
2,9853,10423,10547,11320,10770,11390,11554,1206
8,10873,11560,11717,12304,11753,12325,12470,130
26,11096,
11721,11828,12437,11963,12547,12659,13233,12013
,12833,12886,13425,12957,13544,13546,13992,1012
7,10610,
10872,11561,10995,11716,11722,12326,11219,11830
,11890,12544,11982,12656,12885,13286,11251,1198
0,12069,
12832,12306,12900,12901,13545,12468,12959,13025
,13547,13079,13820,13822,15012,11542,12250,1230
5,12903,
12471,13024,13076,13677,12657,13232,13284,13821
,13426,13823,14476,15014,12694,13424,13427,1399
3,13676,
13994,14477,15015,13678,14478,14479,15284,15013
,15285,15286,15287,1904,1905,1906,2247,1907,2536
,2539,3
452,2244,2538,2865,3516,3088,3677,3679,4686,2245
,2864,2866,3676,3091,3834,4007,4750,3282,4006,39
18,4965,
4213,5037,5197,6058,2246,3089,3281,3916,3283,400
5,4059,4967,3517,4195,4215,5136,4665,5260,5345,6
205,367
8,4385,4684,5263,4749,5422,5611,6270,4964,5621,5
703,6612,5822,6682,6884,7741,2537,3090,3454,4194
,3518,42
14,4664,5199,3832,4685,4386,5346,4869,5541,5657,
6401,4004,4667,4871,5620,5009,5700,5821,6658,513
9,5872,6
068,6818,6204,6984,7158,8009,4193,4966,5137,5820
,5261,5878,6147,6961,5358,6196,6269,6998,6473,72
11,7388,
8212,5623,6379,6615,7313,6680,7389,7553,8367,685
3,7571,7718,8457,7827,8624,8804,9730,2867,3453,3
519,466
6,3835,4748,4751,5656,4056,4870,5010,5819,5196,5
877,5979,6960,4212,5011,5198,5879,5344,6146,6266
,7040,55
40,6267,6400,7182,6657,7385,7447,8347,4438,5258,
5359,6199,5542,6268,6500,7314,5818,6613,6681,739
1,6852,7
570,7619,8456,5978,6763,6962,7587,6999,7771,7833
,8600,7270,7942,8114,8751,8220,8898,9183,9731,44
50,5423,
5659,6503,5876,6659,6851,7585,6059,6854,6986,774
0,7159,7832,8008,8745,6264,7041,7183,7940,7390,8
106,821
4,8940,7441,8222,8402,9078,8468,9232,9326,10207,
6475,7315,7412,8129,7592,8346,8409,9178,7826,845
3,8601,9
314,8752,9399,9615,10379,7951,8658,8805,9524,889
6,9725,9789,10551,9181,9840,9959,10542,10079,107
46,1098
9,11756,3280,3833,3917,5008,4057,5036,5256,6145,
4058,5257,5347,6206,5608,6472,6504,7445,4387,535
6,5609,6
507,5701,6656,6761,7446,5823,6760,6885,7717,7042
,7825,7880,8595,4448,5658,5873,6541,6070,6816,69
63,7824,

6198,6996,7160,7884,7210,8102,8137,8878,6197,720
8,7317,8101,7440,8215,8357,9079,7594,8411,8469,9
215,865
7,9325,9527,10343,4687,6057,6071,6988,6243,7180,
7316,8010,6271,7387,7411,8213,7554,8366,8452,921
1,6855,7
538,7593,8401,7742,8462,8656,9316,7946,8661,8834
,9486,8943,9724,9791,10532,7163,7736,7885,8594,8
100,875
0,8836,9680,8142,8933,8949,9729,9208,9847,10045,
10685,8403,9182,9233,10032,9317,10146,9955,1077
5,9546,1
0340,10380,11067,10431,11305,11466,11894,4868,6
207,6265,7415,6817,7569,7618,8410,6989,7716,7743
,8485,79
43,8663,8807,9684,7161,7941,8013,8744,8128,8837,
8945,9733,8223,8977,9163,9843,9315,10035,10206,1
0779,74
44,8103,8136,8944,8356,9140,9243,9956,8484,9296,
9327,10174,9547,10075,10359,11091,8749,9470,969
0,10341,
9770,10430,10538,11256,9952,10549,10548,11382,1
0776,11537,11589,12213,7719,8221,8448,9297,8662,
9398,95
26,10241,8835,9681,9726,10381,9833,10489,10543,1
1275,8946,9781,9957,10533,10046,10550,10777,115
38,1024
0,10877,10970,11614,11106,11782,11866,12525,921
4,10033,10158,10778,10358,10868,11102,11637,103
78,11093,
11258,11848,11342,11965,12154,12706,10490,11324
,11508,12053,11558,12159,12079,12840,11750,1226
1,12381,
13014,12563,13118,13239,13642,3455,3919,4192,51
38,4384,5357,5610,6501,4439,5622,5702,6506,5875,
6684,676
2,7768,4449,5874,6056,6683,6144,7181,7271,7950,6
376,7312,7414,8143,7568,8360,8449,9313,4451,6069
,6242,72
09,6378,7413,7539,8302,6502,7584,7628,8454,7770,
8625,8747,9404,6614,7737,7835,8660,8011,8806,889
9,9612,8
107,8879,8982,9780,9077,9842,10034,10991,5259,63
77,6474,7555,6540,7629,7769,8487,6819,7881,7947,
8755,81
13,8935,8976,9686,6987,7949,8131,8897,8301,9076,
9085,9830,8400,9086,9162,10044,9467,10147,10278,
11092,7
162,8300,8364,9143,8459,9242,9312,10062,8627,946
6,9541,10237,9728,10350,10428,11259,8754,9614,97
71,1042
9,9953,10495,10687,11343,10155,10708,10900,1153
9,10971,11617,11842,12477,5262,6505,6685,7834,69
85,7948,
8115,8942,7043,8140,8303,9087,8408,9180,9209,100
47,7386,8365,8458,9210,8626,9461,9525,10232,8753
,9550,9 727,10377 ,9831,10491,10662,11272,
7552,8486,87
46,9540,8932,9691,9687,10492,8947,9788,9841,1061
4, 10063, 10
706,10772,11545,9179,9954,10153,10747,10233,109
15,10988,11638,10283,11090,11118,11849,11381,11
977,1215
5,12707,7595,8763,8934,9790,9084,9846,10074,1070
9,9407,10154,10272,10966,10275,10990,11104,1178
1,9471,1
0273,10282,11101,10493,11113,11337,11964,10672,
11380,11499,12072,11588,12240,12314,12847,9551,
10539,10
660,11273,10773,11383,11536,12101,10901,11564,1
1639,12260,11843,12408,12533,13041,11184,11713,
11852,12
415,12011,12565,12634,13237,12112,12669,12837,1
3352,12942,13492,13623,14099,5543,6850,6997,814
1,7384,8
361,8455,9324,7410,8463,8659,9463,8762,9545,9732
,10663,7586,8748,8941,9685,8983,9845,9832,10684,
9141,99
58,10078,10876,10242,10962,10997,11751,8012,894
8,9142,9844,9406,10061,10159,10967,9462,10243,10
277,110
66,10351,11105,11189,11900,9484,10342,10488,111
88,10669,11336,11467,12073,10750,11549,11565,12
241,1171
2,12315,12474,12990,8112,9405,9460,10236,9485,10
274,10376,11112,9613,10494,10615,11304,10707,11
414,1155
9,12183,10152,10668,10774,11498,10902,11615,117
26,12262,11107,11727,11853,12432,12052,12564,12
589,1323
6,10276,10914,11100,11616,11185,11845,11902,124
76,11339,11976,12075,12588,12182,12690,12846,13
359,1150
9,12113,12245,12836,12380,12859,12987,13508,125
24,13015,13111,13603,13184,13797,13835,14405,81
30,9487,
9544,10661,10060,10686,10751,11548,10175,10869,
10963,11636,11103,11780,11895,12475,10279,10996
,11119,1
1783,11274,11903,12078,12585,11415,12158,12074,
12665,12263,12841,12941,13394,10673,11257,11325
,12010,1
1544,12100,12244,12744,11613,12252,12321,12880,
12433,12943,13044,13602,11844,12409,12532,12991
,12635,1
3119,13185,13701,12691,13277,13358,13937,13493,
13998,14014,14296,10903,11338,11612,12253,11757
,12320,1
2414,12986,11867,12562,12584,13110,12668,13160,
13353,13834,11901,12664,12745,13276,12940,13362
,13363,1
3999,13040,13509,13525,14015,13643,14204,14242,
14700,12212,12858,12881,13395,13045,13524,13622
,14081,1
3161,13700,13796,14205,13950,14243,14446,15102,
13238,13936,13951,14297,14080,14404,14447,15103,14098,1
4610,14611,15394,14701,15395,15626,15627,4436,4437,5038,5817,5039,5976,6241,7156,5420,6240,6403,7318,66
86,7443,7537,8634,5421,6402,6542,7442,6849,7630,7945,8718,6990,7944,7882,8839,8211,8981,9161,10014,5816,
6687,6887,7738,6991,7887,8105,8877,7319,8209,8345,9080,8593,9240,9319,10173,7536,8359,8632,9299,8717,94
64,9543,10280,8838,9549,9735,10536,9828,10664,10748,11551,5977,6848,7268,8208,7408,8344,8592,9177,7616,
8633,8362,9396,8761,9469,9651,10365,7886,8603,8833,9548,8951,9688,9783,10616,9083,9834,10040,10710,1017
2,10808,10968,11749,8139,8876,9081,9782,9241,10004,10077,10781,9442,10144,10259,10912,10367,11065,1118
6,11898,9649,10357,10541,11095,10618,11187,11327,12097,10735,11379,11510,12177,11591,12258,12464,13112,
6543,7157,7409,8602,7631,8716,8719,9650,8014,8832,8978,9769,9160,9851,10007,10780,8210,8979,9176,10005,
9318,10076,10256,10960,9468,10257,10364,11048,10613,11115,11309,12055,8450,9234,9443,10157,9520,10258,
10424,11108,9768,10537,10619,11191,10734,11378,11497,12176,10006,10675,10782,11411,10913,11585,11609,1
2256,11088,11714,11854,12383,11978,12526,12709,13113,8470,9465,9683,10427,9850,10617,10733,11409,10015,
10744,10810,11550,10969,11608,11748,12323,10238,10961,11049,11634,11190,11846,11966,12534,11255,12008,
12102,12636,12214,12750,12844,13483,10383,11109,11222,11865,11412,12054,12115,12688,11590,12153,12257,
12790,12410,12857,13031,13605,11747,12312,12465,12954,12522,13105,13165,13703,12705,13190,13279,13696,
13393,13832,14009,14430,6886,7617,7739,8950,8015,8980,9212,10073,8104,9213,9397,10204,9522,10366,10456,
11307,8363,9440,9523,10459,9689,10612,10671,11308,9829,10670,10749,11507,10964,11587,11618,12255,8460,
9682,9835,10535,10042,10704,10783,11586,10 156, 10878, 10972, 11632, 11064, 11840, 11871, 12520, 10 145, 11050, 11
111,11779,11254,11967,12065,12637,11464,12117,12215,12749,12311,12843,12985,13527,8635,10013,10043,108
70,10235,10998,11110,11758,10281,11117,11221,11899,11340,12096,12152,12747,10745,11310,11413,12099,1155
6,12180,12310,12838,11724,12317,12472,12952,12549,13104,13167,13672,10975,11546,11633,12254,11778,1238
2,12478,13042,11896,12529,12567,13109,12710,13253,13355,13795,12103,12708,12751,13280,12839,13396,1327
3,13857,13010,13522,13606,14041,13619,14203,14246,14580,8760,10205,10239,11253,10705,11377,11496,12116,
10871,11506,11557,12243,11715,12319,12467,13046,10973,11635,11777,12322,11864,12479,12551,13115,12009,
12587,12671,13249,12791,13283,13482,13861,11306,11841,11870,12550,12064,12662,12785,13274,12242,12786,
12845,13480,13011,13367,13551,14043,12379,12936,13074,13523,13116,13618,13674,14170,13254,13699,13698,
14240,13858,14293,14355,14751,11511,11979,12118,12787,12318,12856,12984,13489,12473,13043,13106,13607,
13189,13621,13697,14201,12560,13163,13275,13673,13356,13702,13859,14294,13488,13939,13996,14358,14086,
14442,14578,14955,12748,13281,13430,13860,13550,13862,14082,14403,13604,14045,14172,14474,14212,14613,
14744,15098,13640,14206,14290,14643,14302,14747,14697,15130,14428,14767,14839,15210,14959,15282,15343,
15550,7269,7883,8138,9082,8358,9441,9542,10425,8451,9648,9734,10458,9849,10666,10674,11566,8461,9848,10
012,10665,10072,10999,11089,11746,10348,11094,11252,11897,11376,12066,12119,12789,8471,10041,10234,110
51,10356,11223,11311,12050,10426,11408,11504,12156,11584,12259,12377,12860,10540,11547,11611,12316,117
59,12466,12527,13028,11847,12521,12590,13162,12633,13248,13282,14011,9235,10349,10382,11341,10534,1150
5,11567,12247,10711,11619,11725,12413,11851,12531,12586,13072,10811,11745,11869,12523,12049,12632,1263
9,13186,12098,12660,12670,13354,12899,13397,13510,14044,10974,12048,12076,12667,12179,12784,12788,1336
4,12309,12898,12989,13487,13108,13548,13616,14173,12412,13030,13117,13617,13255,13647,13799,14213,1342
9,13818,13940,14295,13997,14401,14444,14953,9298,10457,10667,11610,10809,11744,11855,12548,10965,11892,
12051,12661,12114,12704,12711,13357,11116,12077,12178,12746,12308,12883,12955,13484,12411,13012,13107,
13601,13187,13641,13780,14174,11326,12246,12376,12988,12528,13075,13073,13644,12561,13164,1319
1,13776,
13365,13816,13838,14299,12689,13272,13399,13833
,13485,13945,14008,14406,13521,14042,14100,1447
5,14215,
14615,14745,15099,11465,12435,12530,13166,12638
,13252,13366,13819,12863,13428,13494,13948,1350
5,14010,
14084,14441,12937,13495,13520,14047,13645,14097
,14209,14612,13792,14214,14289,14644,14354,1476
0,14834,
15133,13013,13675,13778,14175,13839,14241,14292
,14699,13941,14352,14407,14766,14445,14896,1495
7,15213,
14102,14425,14576,14899,14641,15009,15066,15341
,14702,15071,15129,15396,15172,15476,15549,1596
3,9521,
10732,10879,11893,11114,12067,12157,12842,11220
,12181,12313,12897,12434,13009,13114,13781,1141
0,12378,
12535,13047,12591,13251,13188,13794,12663,13278
,13392,13938,13490,13946,14013,14429,11776,1256
6,12666,
13250,12862,13361,13431,13949,12896,13491,13507
,14040,13549,14085,14169,14582,12938,13526,1362
0,14168,
13783,14208,14247,14645,13836,14301,14353,14761
,14424,14835,14902,15208,11850,12861,12882,1348
6,12939,
13504,13600,14096,13029,13646,13777,14202,13817
,14244,14303,14749,13398,13782,13856,14288,1394
2,14359,
14426,14832,14087,14427,14577,14900,14642,15008
,15065,15340,13506,13944,14046,14400,14103,1447
3,14608,
14952,14211,14614,14647,15064,14748,15096,15132
,15399,14291,14703,14763,15128,14838,15135,1517
5,15478,
14954,15211,15281,15547,15338,15629,15631,16139
,11868,12953,13008,13779,13360,13798,13837,1430
0,13481,
13863,13947,14402,14083,14440,14581,14903,13511
,14012,14101,14443,14200,14609,14696,15011,1424
5,14746,
14646,15069,14833,15131,15171,15474,13793,14171
,14207,14640,14298,14698,14762,15100,14357,1476
4,14837,
15168,14901,15173,15214,15546,14472,14897,14956
,15209,15067,15283,15339,15625,15097,15393,1539
8,15697,
15477,15700,15702,16136,13943,14210,14356,14765
,14431,14836,14898,15174,14579,14958,15010,1528
0,15070,
15336,15397,15630,14583,15068,15101,15392,15170
,15472,15473,15701,15212,15479,15545,15703,1555
1,15964,
15966,16232,14750,15134,15169,15475,15215,15544
,15548,15961,15337,15624,15628,15965,15698,1596
7,16140,
16234,15342,15696,15699,16137,15960,16138,16141
,16235,15962,16142,16143,16236,16233,16237,1623
8,16239,
2608,2609,2610,2615,2611,3288,3291,4096,2612,329
0,3293,4100,3696,4321,4323,5414,2613,3292,3294,4
320,369
9,4326,4679,5498,3702,4678,4674,5625,5081,5809,5
969,6894,2614,3697,3701,4672,3703,4677,4875,5627
,4101,48
79,5083,5812,5409,6072,6077,6981,4322,5085,5412,
6075,5497,6182,6339,7174,5624,6341,6535,7488,659
0,7546,7
764,8617,3289,3698,4098,4878,4102,5082,5408,5971
,4324,5413,5086,6078,5501,6253,6529,7309,4676,54
11,5503,
6340,5629,6532,6589,7494,5815,6664,6904,7722,698
0,7804,7918,8865,4877,5626,5813,6588,6073,6670,6
911,780
1,6178,6976,7173,7878,7361,7983,8164,9096,6343,7
307,7491,8085,7544,8165,8341,9227,7761,8475,8610
,9409,87
07,9476,9792,10634,3295,4097,4103,5410,4327,5496
,5499,6528,4872,5502,5630,6587,5968,6669,6891,78
00,5080,
5631,5970,6671,6076,6910,7170,7912,6252,7171,730
8,7978,7493,8093,8319,9171,5274,5974,6179,6979,6
254,717
2,7364,8086,6586,7489,7545,8167,7760,8474,8495,9
408,6890,7567,7802,8479,7879,8623,8709,9472,8082
,8822,89
58,9715,9152,9910,10119,10635,5278,6183,6531,736
7,6668,7495,7727,8477,6895,7762,7806,8616,7919,8
708,886
4,9661,7168,7913,7979,8820,8166,8954,9098,9916,8
313,9154,9230,9994,9416,10192,10270,11059,7363,8
087,829
2,9041,8488,9170,9305,10114,8706,9333,9473,10250
,9716,10307,10559,11299,8847,9602,9793,10484,990
8,10629,
10737,11439,10117,10804,10891,11434,11027,11626
,11837,12572,3700,4325,4673,5628,4873,5808,5972,
6909,48
74,5973,6079,6982,6336,7360,7368,8317,5087,6176,
6337,7371,6533,7492,7565,8318,6591,7564,7765,860
9,7914,8
705,8736,9455,5276,6530,6665,7373,6906,7720,7803
,8704,6978,7876,7972,8816,7982,8906,9045,9906,69
77,7980,
8089,8905,8312,9099,9173,9995,8490,9307,9417,101
67,9601,10269,10487,11195,5415,6893,6907,7872,70
67,7976,
8088,8866,7175,8095,8291,9097,8342,9226,9332,101
63,7763,8338,8489,9229,8618,9414,9600,10264,8842
,9605,9 798,10454,9919,10628,10739, 11424,
7975,8612,8817,9454,8904,9714,9800,
10600,9090,9913,9945, 10633, 10 160, 10
819,10925,11577,9231,10118,10193,10908,10265,11

034,10831,11643,10522,11192,11312,11883,11347,1
2121,122
38,12654,5500,6983,7169,8295,7721,8473,8494,9306
,7873,8608,8619,9449,8823,9607,9795,10604,7973,8
821,886
9,9660,9040,9801,9941,10713,9155,9949,10071,1080
7,10251,10911,11058,11647,8316,8907,9044,9940,91
72,1006
4,10199,10888,9448,10228,10271,11046,10523,1100
3,11231,11887,9713,10450,10626,11193,10718,1134
6,11430,1
2060,10828,11437,11436,12218,11644,12301,12405,
12961,8611,9153,9328,10229,9606,10306,10486,111
29,9799,
10601,10630,11313,10801,11353,11435,12111,9942,
10725,10889,11425,10926,11438,11645,12302,11128
,11697,1
1806,12446,11950,12594,12646,13221,10166,10909,
11042,11646,11230,11672,11942,12457,11298,11937
,12062,1
2604,12198,12777,12914,13422,11354,12184,12292,
12805,12386,12923,12867,13528,12558,13017,13097
,13706,1
3263,13810,13867,14266,4099,4675,4876,5814,5084,
6177,6338,7365,5275,6342,6534,7370,6667,7548,756
6,8620,
5277,6666,6892,7547,6908,7977,8083,8846,7304,808
4,8294,9091,8472,9220,9329,10249,5279,6905,7066,
7981,73
06,8293,8339,9158,7366,8476,8500,9334,8622,9477,
9663,10312,7490,8613,8711,9604,8867,9794,9911,10
556,895
5,9907,9986,10724,9993,10806,10910,11839,5975,73
05,7362,8343,7372,8501,8621,9451,7723,8737,8843,
9719,89
57,9915,9948,10606,7807,8845,9043,9909,9157,9992
,10053,10742,9228,10054,10070,10924,10375,11035,
11142,1
1936,7974,9156,9224,10067,9411,10198,10248,1098
2,9479,10374,10513,11121,10632,11226,11344,1206
3,9718,1
0558,10719,11345,10829,11359,11579,12199,11039,
11600,11708,12303,11807,12449,12598,13181,6074,
7369,754
9,8710,7805,8844,8959,9918,7915,9088,9159,10055,
9304,10116,10161,10927,8094,9225,9410,10162,947
8,10369,
10485,11060,9717,10554,10631,11297,10743,11355,
11494,12108,8340,9450,9662,10512,9912,10627,106
07,11356,
9943,10736,10805,11458,10983,11598,11640,12329,
10115,10830,11037,11627,11061,11787,11836,12458
,11151,1
1886,12002,12605,12217,12781,12915,13423,8491,9
743,9914,10738,10052,10818,11002,11601,10315,11
038,1113
6,11802,11139,11838,11948,12593,10451,11137,111
50,11941,11357,11973,12189,12776,11572,12216,12
267,12852,
12404,12964,13038,13535,10555,11431,11492,12109
,11641,12219,12300,12877,11709,12392,12459,1301
6,12599,
13144,13241,13713,12032,12517,12640,13151,12795
,13289,13346,13865,12892,13385,13513,13964,1361
4,14120,
14251,14619,6255,7726,7877,9089,8092,9221,9335,1
0268,8290,9415,9603,10371,9742,10521,10712,1149
5,8478,
9712,9917,10605,9987,10817,10800,11576,10065,10
890,11026,11696,11130,11790,11861,12559,8868,99
44,10066,
10816,10314,10981,11043,11803,10370,11131,11141
,11882,11227,11949,12037,12740,10452,11194,1135
2,12036,
11517,12188,12239,12853,11630,12333,12393,12965
,12516,13039,13178,13686,8956,10313,10368,11120,
10453,1
1138,11296,11972,10557,11358,11459,12120,11599,
12234,12387,12935,11036,11516,11642,12266,11710
,12447,1
2538,13018,11951,12539,12641,13168,12804,13288,
13321,13864,11140,11786,11940,12448,12033,12601
,12742,1
3180,12191,12780,12855,13320,12934,13414,13534,
13991,12293,12893,12969,13512,13096,13543,13671
,14156,1
3220,13707,13747,14195,13828,14377,14411,14885,
9042,10455,10520,11493,10980,11578,11631,12332,
11047,11
673,11791,12456,11943,12592,12655,13179,11143,1
1860,12003,12595,12110,12743,12866,13293,12235,
12922,12
854,13381,13019,13529,13613,14034,11573,12061,1
2185,12794,12328,12876,12968,13436,12445,12972,
13089,13
564,13169,13615,13716,14194,12600,13145,13240,1
3687,13347,13811,13829,14321,13415,13929,13990,
14481,14
121,14530,14558,14824,11711,12190,12444,12973,1
2573,13088,13150,13670,12647,13262,13292,13746,
13384,13
812,13965,14410,12741,13380,13437,13928,13612,1
4006,14007,14531,13712,14157,14185,14559,14267,
14712,14
738,15140,12960,13542,13565,14035,13717,14184,1
4250,14593,13813,14320,14376,14713,14522,14739,
14966,15
382,13866,14480,14523,14825,14592,14884,14967,1
5383,14618,15038,15039,15666,15141,15667,15802,
15803,52
72,5273,5810,6585,5811,6888,7065,7916,6180,7064,
7311,8090,7550,8315,8337,9566,6181,7310,7374,831
4,7725,8
502,8841,9658,7874,8840,8738,9803,9095,9985,1006
9,10906,6584,7551,7767,8614,7875,8819,8953,9905,
8091,90 93,9169,9996,9453,10196,10267,11045,8336,9175,9564,10231,9657,10372,10515,11148,9802,10553,10715,11428,10740,11512,11628,12335,6889,7724,8080,9092,8288,9168,9452,10113,8492,9565,9222,10304,9741,10449,10599,11269,8818,9475,9797,10552,9947,10624,10727,11460,9999,10802,10920,11602,11044,11668,11804,12557,9047,9904,9997,10726,10197,10892,11025,11665,10318,11032,11135,11784,11271,11881,12034,12738,10597,11229,11433,11939,11462,12035,12187,12869,11607,12207,12294,12929,12407,12982,13172,13752,7375,7917,8289,9474,8503,9656,9659,10598,8870,9796,9950,10717,10068,10827,10895,11664,9094,9951,10112,10893,10266,11024,11132,11788,10448,11133,11268,11876,11457,11975,12125,12807,9330,10194,10319,11041,10480,11134,11316,11952,10716,11429,11463,12039,11606,12206,12265,12928,10894,11575,11666,12223,11785,12397,12441,12980,11884,12518,12642,13099,12782,13222,13433,13753,9418,10373,10603,11319,10826,11461,11605,12221,10907,11624,11670,12334,11805,12440,12556,13091,11122,11789,11877,12454,12038,12602,12778,13242,12059,12792,12878,13368,12962,13458,13532,14075,11315,11953,12042,12645,12232,12806,12895,13412,12406,12913,12981,13498,13146,13541,13711,14221,12555,13036,13173,13626,13194,13741,13825,14323,13421,13842,13931,14312,14033,14408,14549,14922,7766,8493,8615,9946,8871,9984,10164,11001,8952,10165,10305,11056,10482,11270,11348,12123,9223,10316,10483,11351,10625,11456,11519,12124,10741,11518,11629,12291,11800,12399,12450,12975,9412,10602,10803,11427,10922,11596,11667,12398,11040,11698,11832,12452,11880,12596,12651,13192,11033,11878,11955,12579,12058,12779,12813,13369,12236,12909,12963,13457,13023,13531,13669,14187,9567,10905,10923,11674,11063,11862,11954,12574,11149,12001,12041,12739,12196,12868,12912,13439,11625,12126,12233,12871,12384,12932,13022,13514,12536,13053,13176,13624,13245,13740,13827,14308,11835,12330,12453,12974,12578,13098,13182,13714,12736,13229,13291,13745,13434,13893,13967,14367,12879,13432,13459,13932,13515,14036,13901,14437,13690,14162,14222,14573,14239,14691,14774,15024,9740,11057,11123,12057,11597,12205,12264,12908,11675,12290,12385,12967,12519,13055,13175,13718,11833,12455,12577,13090,12644,13183,13247,13755,12793,13295,13387,13889,13499,13935,14074,14457,12122,12597,12650,13246,12812,13374,13461,13902,12966,13462,13533,14072,13691,14027,14191,14575,13095,13608,13730,14163,13808,14238,14310,14638,13894,14315,14314,14736,14438,14793,14859,15167,12295,12783,12910,13463,13054,13540,13668,14105,13177,13715,13742,14223,13841,14249,14313,14689,13260,13815,13903,14309,13988,14322,14439,14794,14104,14483,14528,14866,14602,14950,15018,15291,13456,13933,14066,14456,14190,14458,14594,14875,14220,14585,14676,14978,14732,15045,15148,15366,14264,14714,14778,15059,14854,15151,15117,15434,14920,15195,15247,15518,15295,15562,15639,15766,8081,8739,9046,9998,9174,10317,10514,11317,9331,10596,10714,11350,10825,11514,11574,12394,9413,10824,10904,11513,11000,11863,11885,12554,11224,11938,12056,12737,12204,12814,12911,13497,9419,10921,11062,11879,11228,12043,12127,12798,11318,12220,12288,12920,12396,12983,13093,13556,11432,12331,12443,13052,12575,13174,13223,13708,12603,13193,13322,13814,13345,13888,13934,14551,10195,11225,11314,12197,11426,12289,12395,12971,11603,12451,12537,13149,12607,13231,13294,13728,11671,12553,12649,13195,12797,13344,13371,13830,12870,13372,13386,13966,13591,14037,14158,14584,11834,12796,12864,13383,12931,13460,13496,14024,13021,13590,13685,14095,13744,14188,14236,14677,13148,13710,13809,14237,13895,14271,14379,14733,14065,14382,14484,14795,14529,14873,14964,15289,10230,11349,11515,12442,11669,12552,12643,13244,11801,12652,12799,13373,12894,13420,13435,13989,12000,12865,12930,13438,13020,13567,13627,14092,13147,13704,13743,14193,13831,14265,14340,14678,12186,12970,13092,13684,13228,13731,13729,14268,13261,13824,13843,14328,14025,14380,14418,14827,13413,13900,14039,14409,14093,14493,14548,14886,14161,14574,14632,14979,14735,15047,15149,15367,12237,13171,13230,13826,13370,13892,14026,14383,13559,14064,14122,1
4520,14153,14550,14600,14949,13609,14123,14160,14587,14269,14617,14721,15044,14364,14734,14777,15112,1
4858,15184,15230,15449,13705,14311,14330,14679,14419,14737,14792,15119,14485,14856,14887,15194,14965,1
5248,15293,15525,14634,14913,15016,15251,15057,15321,15346,15637,15142,15359,15433,15692,15492,15724,1
5765,15951,10481,11604,11699,12653,11974,12815,12921,13530,12040,12933,13037,13589,13170,13689,13754,1
4341,12222,13094,13243,13719,13323,13891,13840,14366,13375,13930,14032,14482,14106,14494,14557,14921,1
2576,13290,13382,13890,13558,14005,14067,14521,13588,14107,14155,14572,14189,14601,14637,15026,13610,1
4186,14248,14636,14343,14720,14775,15113,14416,14853,14857,15185,14912,15231,15266,15516,12606,13557,1
3566,14094,13611,14152,14192,14616,13709,14270,14329,14690,14381,14772,14855,15165,14038,14342,14436,1
4776,14486,14867,14914,15228,14603,14915,15017,15264,15058,15320,15345,15636,14154,14492,14586,14872,1
4635,14977,15036,15288,14723,15046,15115,15344,15164,15364,15448,15695,14779,15143,15187,15432,15246,1
5451,15495,15726,15290,15519,15561,15747,15610,15829,15831,16027,12648,13625,13688,14331,14004,14378,1
4417,14852,14073,14459,14495,14874,14595,14948,15025,15267,14159,14556,14633,14951,14688,15037,15116,1
5323,14773,15150,15114,15357,15229,15435,15467,15710,14365,14639,14715,15056,14826,15118,15186,15380,1
4865,15192,15245,15464,15265,15493,15526,15746,14976,15249,15292,15517,15347,15563,15611,15801,15365,1
5665,15694,15857,15725,15912,15914,16024,14487,14722,14864,15193,14923,15244,15250,15494,15019,15294,1
5322,15560,15358,15608,15693,15830,15027,15356,15381,15664,15466,15708,15709,15913,15524,15727,15745,1
5915,15767,15988,15990,16260,15166,15450,15465,15711,15527,15744,15764,15949,15609,15800,15828,15989,1
5858,15991,16172,16262,15638,15856,15859,16025,15948,16026,16173,16263,15950,16174,16175,16308,16261,1
6309,16310,16311,6248,6249,6250,7071,6251,7560,7563,8740,7068,7562,7969,8908,8160,9101,9103,10254,7069,
7968,7970,9100,8163,9218,9423,10310,8498,9422,9310,10525,9805,10637,10821,11570,7070,8161,8497,9308,849
9,9421,9563,10527,8909,9739,9807,10720,10225,10884,10977,11701,9102,9937,10252,10887,10309,11030,11147,
11798,10524,11197,11303,12044,11334,12146,12268,12949,7561,8162,8742,9738,8910,9806,10224,10823,9216,1
0253,9938,10978,10517,11125,11265,11873,9420,10227,10519,11196,10593,11300,11333,12106,10723,11416,115
80,12202,11700,12368,12462,13153,9737,10526,10721,11332,10885,11422,11595,12297,11006,11676,11797,1239
0,11945,12571,12700,13316,11199,11859,12047,12625,12144,12701,12809,13407,12229,12851,12926,13473,1303
5,13560,13692,14258,7971,8741,8911,10226,9219,10308,10311,11264,9560,10518,10594,11331,10820,11421,114
91,12296,9804,10595,10822,11423,10976,11594,11794,12400,11124,11795,11872,12542,12105,12697,12775,1337
9,9990,10882,11007,11679,11126,11796,11956,12626,11330,12045,12145,12703,12228,12850,12907,13472,11490,
12195,12298,12875,12391,12979,13049,13552,12582,13102,13226,13639,13324,13738,13927,14259,10050,11031,
11267,11959,11420,12107,12227,12873,11571,12230,12370,12948,12463,13048,13152,13633,11792,12401,12543,
13100,12702,13218,13318,13756,12769,13326,13410,13846,13500,13960,14030,14535,11947,12627,12716,13257,
12888,13378,13417,13922,13034,13469,13553,14018,13664,14071,14199,14627,13143,13594,13693,14148,13736,
14253,14325,14719,13925,14344,14375,14710,14471,14818,14917,15268,8496,9217,9309,10592,9561,10636,1088
0,11593,9562,10881,10979,11702,11144,11944,11968,12773,9939,11004,11145,11971,11301,12104,12193,12774,1
1335,12192,12269,12925,12402,13033,13080,13539,10048,11266,11417,12005,11582,12200,12299,13032,11678,1
2388,12512,13084,12570,13198,13265,13734,11677,12568,12629,13197,12768,13319,13389,13847,12890,13419,1
3501,13959,13593,14029,14151,14591,10255,11569,11583,12372,11707,12540,12628,13154,11799,12699,12715,1
3317,12810,13406,13468,13955,12231,12802,12889,13409,12950,13478,13592,14020,13138,13597,13722,14126,1
3759,14252,14327,14692,12515,12944,13085,13538,13196,13638,13724,14224,13270,13749,13789,14257,13952,14351,14453,14781,13411,13926,13961,14432,14021,14490,14371,14831,14178,14588,14628,14963,14655,15049,15138,15326,10516,11703,11793,12719,12201,12849,12906,13418,12373,12924,12951,13517,13103,13599,13695,14228,12513,13101,13157,13632,13256,13725,13785,14261,13327,13801,13899,14347,14019,14435,14534,14843,12772,13199,13264,13784,13388,13868,13987,14372,13516,14000,14031,14526,14179,14467,14607,14971,13637,14118,14234,14589,14306,14654,14706,15032,14368,14717,14716,15110,14840,15161,15205,15437,12927,13325,13464,14001,13598,14070,14150,14545,13723,14225,14254,14629,14337,14681,14711,15043,13786,14317,14373,14693,14454,14718,14841,15162,14544,14869,14906,15222,14986,15278,15314,15541,13958,14433,14518,14842,14606,14860,14982,15237,14626,14973,15034,15304,15094,15349,15418,15642,14682,15060,15156,15373,15190,15423,15391,15672,15262,15461,15501,15742,15587,15782,15807,15938,8743,9311,9736,10722,9936,11005,11146,11957,9991,11198,11302,11970,11419,12148,12194,12976,10049,11418,11568,12147,11592,12541,12583,13142,11856,12624,12718,13271,12848,13400,13465,14017,10051,11581,11706,12569,11858,12717,12803,13350,11958,12872,12916,13470,12978,13561,13635,14076,12046,12945,13051,13596,13155,13694,13739,14196,13219,13735,13806,14316,13845,14346,14434,14919,10883,11857,11946,12811,12004,12917,12977,13519,12203,13081,13139,13667,13225,13751,13800,14230,12371,13141,13259,13737,13349,13844,13853,14334,13408,13854,13898,14452,14115,14491,14566,14972,12514,13348,13404,13871,13475,13986,14016,14462,13563,14114,14165,14541,14256,14598,14652,15035,13666,14198,14307,14653,14369,14687,14783,15095,14515,14788,14876,15163,14907,15225,15298,15533,10886,11969,12149,13050,12369,13140,13227,13758,12403,13268,13351,13855,13416,13924,13953,14455,12698,13405,13474,13954,13562,14109,14149,14536,13665,14182,14255,14625,14335,14683,14742,15040,12808,13518,13634,14164,13748,14235,14231,14684,13787,14324,14345,14726,14463,14786,14828,15177,13923,14370,14513,14819,14537,14883,14916,15238,14571,14970,14998,15305,15109,15353,15419,15643,12891,13683,13750,14326,13852,14350,14466,14789,14079,14514,14560,14894,14563,14918,14984,15277,14119,14561,14570,14981,14685,14993,15089,15348,14768,15108,15147,15384,15204,15440,15482,15679,14183,14707,14740,15041,14829,15111,15160,15405,14877,15196,15239,15460,15299,15504,15557,15753,15000,15241,15308,15511,15363,15589,15602,15805,15408,15621,15669,15832,15718,15876,15935,16059,11127,12226,12389,13269,12696,13401,13471,14028,12714,13479,13595,14111,13682,14177,14260,14743,12874,13636,13757,14229,13807,14349,14336,14780,13869,14374,14470,14868,14546,14890,14925,15263,13156,13788,13870,14348,14078,14461,14519,14895,14110,14547,14565,14962,14599,14985,15005,15332,14124,14590,14680,15004,14757,15088,15139,15385,14822,15181,15197,15441,15240,15483,15530,15734,13224,14077,14108,14540,14125,14562,14624,14992,14197,14686,14727,15048,14787,15126,15191,15431,14512,14756,14830,15146,14878,15223,15254,15462,14987,15255,15309,15512,15372,15588,15597,15804,14564,14882,14980,15224,15001,15301,15334,15532,15091,15352,15387,15596,15430,15634,15678,15839,15157,15409,15445,15668,15500,15683,15731,15884,15540,15743,15775,15923,15792,15981,15995,16149,13258,14127,14176,14741,14460,14782,14823,15180,14527,14861,14891,15236,14983,15276,15327,15531,14567,14924,14999,15279,15042,15335,15390,15593,15127,15422,15386,15617,15463,15673,15717,15850,14769,15033,15061,15362,15176,15404,15444,15648,15221,15452,15489,15688,15513,15719,15756,15922,15300,15505,15556,15735,15603,15783,15793,15957,15635,15821,15838,16009,15877,16030,16038,16120,14879,15090,15220,15453,15269,15488,15510,15730,15315,15586,15592,15774,15620,15784,15833,15994,15333,15616,15649,15820,15716,15842,15843,16031,15752,15885,15909,16039,15939,16076,16106,16204,15436,15682,15689,15851,15757,15908,15934,16049,15785,15956,15980,16077,16022,16107,16166,16278,15806,16008,16023,16121,1 6048,16148,16167,16279,16058,16186,16187,16322,
16205,16323,16346,16347,9988,9989,10638,11329,1
0639,114
88,11705,12460,11028,11704,11875,12630,12150,12
771,12801,13586,11029,11874,12006,12770,12225,1
2918,131
37,13630,12374,13136,13082,13727,13315,13805,13
897,14422,11328,12151,12271,12946,12375,13087,1
3217,137
33,12631,13313,13377,13848,13537,13984,14023,14
525,12800,13391,13584,14003,13629,14112,14167,1
4568,137
26,14181,14263,14704,14332,14752,14820,15183,11
489,12224,12580,13312,12712,13376,13536,13921,1
2904,135
85,13402,14068,13681,14117,14219,14621,13086,13
555,13721,14180,13791,14232,14319,14728,13851,1
4338,144
48,14790,14524,14848,14904,15261,13267,13732,13
849,14318,13985,14412,14469,14845,14090,14488,1
4555,148
80,14623,14961,15002,15330,14217,14605,14709,14
975,14730,15003,15063,15401,14799,15107,15158,1
5425,152
07,15458,15520,15776,12007,12461,12713,13554,12
919,13628,13631,14218,13158,13720,13802,14305,1
3896,143
63,14415,14844,13314,13803,13920,14413,14022,14
468,14552,14888,14116,14553,14620,14944,14725,1
4995,150
53,15375,13466,13962,14091,14517,14144,14554,14
648,14988,14304,14705,14731,15007,14798,15106,1
5145,154
24,14414,14771,14846,15123,14881,15201,15217,15
456,14968,15242,15310,15503,15354,15542,15645,1
5777,135
02,14113,14227,14651,14362,14729,14797,15121,14
423,14816,14850,15182,14905,15216,15260,15491,1
4542,148
89,14945,15234,15006,15302,15350,15558,15031,15
360,15406,15604,15438,15654,15676,15867,14631,1
4989,150
22,15313,15124,15374,15411,15632,15206,15417,15
457,15662,15506,15681,15751,15925,15259,15480,1
5521,157
22,15538,15769,15789,15959,15641,15798,15823,15
952,15849,15992,16033,16158,12270,12905,12947,1
3790,131
59,13804,13956,14465,13216,13957,14069,14532,14
146,14622,14672,15051,13403,14088,14147,14675,1
4233,147
24,14759,15052,14333,14758,14821,15155,14892,15
203,15226,15455,13476,14226,14339,14695,14450,1
4784,148
47,15202,14516,14870,14908,15232,14960,15296,15
319,15536,14489,14946,14991,15275,15030,15351,1
5377,156
05,15136,15413,15439,15653,15471,15675,15729,15
911,13587, 14421, 14451, 14862, 14539, 14926, 14990,
15270, 145
69,14997,15021,15331,15092,15400,15416,15651,14
817,15054,15125,15403,15188,15428,15470,15670,1
5252,154
85,15528,15720,15565,15768,15791,15944,14911,15
178,15233,15454,15274,15502,15534,15754,15328,1
5553,155
91,15773,15646,15813,15835,15979,15407,15644,15
655,15824,15671,15852,15817,16001,15738,15906,1
5926,160
41,15931,16075,16110,16180,13680,14533,14543,15
029,14785,15105,15144,15412,14863,15154,15189,1
5443,152
43,15487,15523,15758,14909,15235,15273,15490,15
312,15535,15567,15779,15361,15595,15623,15809,1
5663,158
27,15866,16005,15050,15297,15318,15566,15376,15
614,15657,15818,15442,15658,15677,15864,15739,1
5847,159
19,16043,15499,15712,15762,15907,15780,15930,15
946,16066,15814,15955,15954,16104,16002,16117,1
6131,162
15,15159,15355,15414,15659,15486,15680,15728,15
873,15529,15755,15770,15927,15797,15933,15953,1
6073,155
84,15787,15819,15945,15836,15958,16003,16118,15
872,16011,16028,16134,16054,16162,16178,16251,1
5652,158
25,15862,16004,15918,16006,16050,16147,15924,16
045,16068,16170,16100,16189,16208,16274,15936,1
6078,161
14,16195,16126,16211,16201,16282,16156,16223,16
231,16298,16255,16306,16319,16342,12581,13083,1
3266,138
50,13390,14089,14166,14649,13467,14216,14262,14
674,14361,14754,14770,15198,13477,14360,14420,1
4753,144
64,14927,14969,15258,14596,14974,15028,15329,15
104,15378,15415,15661,13503,14449,14538,14947,1
4604,150
23,15055,15370,14650,15120,15152,15420,15200,15
459,15497,15684,14708,15179,15219,15484,15271,1
5522,155
43,15748,15303,15537,15598,15786,15601,15808,15
826,16035,13963,14597,14630,15093,14694,15153,1
5199,154
47,14791,15227,15253,15509,15307,15555,15594,15
760,14851,15257,15317,15539,15369,15600,15607,1
5794,154
02,15612,15622,15834,15707,15853,15886,16044,14
910,15368,15388,15619,15427,15656,15660,15844,1
5469,157
06,15733,15871,15772,15916,15928,16069,15508,15
750,15781,15929,15815,15943,15983,16101,15861,1
5986,160
12,16119,16029,16145,16164,16249,14002,14673,14
755,15218,14849,15256,15311,15564,14893,15324,1

5371,156
13,15410,15640,15647,15837,14996,15389,15426,15
650,15468,15691,15723,15868,15507,15740,15771,1
5921,157
95,15937,15972,16070,15062,15446,15496,15732,15
552,15763,15761,15940,15585,15788,15799,15968,1
5845,159
84,15998,16123,15633,15816,15855,15993,15869,16
017,16032,16150,15905,16042,16060,16171,16103,1
6191,162
09,16275,15137,15515,15554,15790,15606,15812,15
846,15987,15687,15860,15878,16020,15881,16034,1
6052,161
61,15713,15879,15904,16047,15941,16057,16097,16
188,15976,16102,16113,16196,16130,16216,16226,1
6285,157
41,15947,15970,16071,15999,16105,16116,16203,16
013,16128,16151,16222,16165,16240,16253,16301,1
6062,161
53,16176,16243,16193,16257,16266,16317,16206,16
271,16281,16324,16292,16332,16341,16363,14145,1
4796,148
71,15325,14994,15379,15421,15674,15020,15429,15
481,15705,15514,15737,15778,15973,15122,15498,1
5559,157
59,15599,15811,15796,15978,15615,15822,15848,16
010,15874,16018,16037,16157,15272,15590,15618,1
5810,156
86,15841,15863,16021,15704,15875,15883,16040,15
917,16053,16065,16182,15714,15910,15932,16064,1
5975,160
96,16111,16197,15996,16125,16129,16217,16152,16
227,16246,16296,15306,15685,15690,15870,15715,1
5880,159
20,16056,15749,15942,15969,16074,15985,16108,16
127,16213,15854,15974,16000,16112,16014,16135,1
6154,162
24,16055,16155,16177,16244,16194,16256,16265,16
316,15882,16016,16046,16144,16063,16169,16184,1
6248,160
99,16190,16199,16264,16212,16272,16284,16327,16
115,16207,16219,16280,16230,16287,16295,16334,1
6250,162
99,16305,16339,16314,16349,16351,16371,15316,15
721,15736,15971,15840,15982,15997,16124,15865,1
6007,160
19,16146,16051,16160,16181,16247,15887,16036,16
061,16163,16072,16185,16200,16259,16109,16210,1
6198,162
69,16225,16283,16291,16330,15977,16067,16079,16
192,16122,16202,16218,16276,16133,16220,16229,1
6288,162
45,16293,16302,16338,16168,16241,16252,16297,16
267,16307,16315,16345,16273,16321,16326,16353,1
6333,163
56,16358,16368,16015,16098,16132,16221,16159,16
228,16242,16294,16179,16254,16258,16304,16270,1
6312,163
25,16350,16183,16268,16277,16320,16290,16328,16
329,16357,16300,16335,16337,16359,16343,16364,1
6366,163
76,16214,16286,16289,16331,16303,16336,16340,16
361,16313,16344,16348,16365,16354,16367,16372,1
6378,163
18,16352,16355,16369,16360,16370,16373,16379,16
362,16374,16375,16380,16377,16381,16382,16383]

**Sequence group 3: Q3_2048**

[0,1,2,4,8,16,32,3,5,64,1024,9,6,17,10,18,128
,12,33,65,20,256,34,24,36,7,129,66,512,11,40,68,130,
19,1
3,48,14,72,257,1025,21,132,35,258,26,513,80,37,25,2
2,136,260,264,38,514,96,67,41,144,28,69,42,516,49,1
026,74,
272,160,520,288,528,192,544,70,44,131,81,50,73,15,
320,133,52,1028,23,134,384,76,137,82,56,27,97,39,2
59,84,13
8,145,261,1032,29,43,98,515,88,140,30,146,71,262,2
65,161,576,45,1040,100,640,51,148,46,75,266,273,51
7,104,16
2,53,193,1056,152,77,164,768,268,274,518,54,83,57,
521,1027,112,135,78,289,194,85,276,522,58,168,102
9,139,99,
86,60,280,89,290,529,524,196,1088,141,101,147,176,
142,530,321,31,200,1033,90,545,292,322,532,263,14
9,102,10
5,1030,304,296,163,92,47,267,385,546,324,1041,208,
386,150,153,165,106,55,1034,328,536,577,548,113,1
54,79,26
9,1042,108,578,224,166,519,552,195,1152,270,641,5
23,275,580,291,59,1036,169,560,114,277,156,87,197,
1057,11
6,170,61,531,525,642,281,1089,278,526,177,293,388,
91,1044,584,769,198,172,120,201,336,1280,62,282,1
43,103,1
78,294,1058,93,644,202,592,323,1048,392,297,770,1
07,180,151,1060,209,284,648,94,204,298,1031,400,6
08,352,3
25,533,1153,155,210,305,547,300,1090,109,184,534,
537,115,167,1536,225,326,306,772,157,1035,656,329
,110,117,
212,1064,171,776,330,226,549,1092,538,387,308,216
,1154,416,271,279,158,337,1043,550,672,118,332,57
9,1037,
540,389,173,121,1072,553,199,784,179,1038,228,338
,312,704,390,1096,174,554,581,393,1281,283,122,44
8,353,10
45,561,203,63,340,1156,394,527,582,556,181,1059,2
95,285,232,124,1282,205,182,643,562,1050,286,585,
299,1537,
354,211,401,185,1104,396,344,586,645,1061,593,535
,240,206,1049,95,327,564,1046,800,402,356,307,116
0,301,4
17,213,568,1284,832,588,186,1288,646,404,227,896,
1062,594,418,302,1538,649,771,360,539,1120,111,33

1,214,10
91,309,188,449,1065,217,408,609,596,1168,551,650,
229,1052,159,420,310,1093,541,773,610,1066,657,33
3,119,15
40,600,339,218,1073,368,652,230,1098,391,313,450,
1296,542,334,233,1184,555,774,175,1544,123,658,61
2,1312,3
41,777,220,1552,314,424,395,1216,673,583,355,1568
,287,183,234,1094,125,557,660,1068,616,342,316,11
55,241,7
78,1105,563,345,452,1074,397,403,207,1097,674,558
,1039,785,432,357,1344,187,236,664,1157,624,587,1
076,780,
705,126,1047,242,565,1158,398,346,456,1408,358,40
5,1100,303,569,244,1161,595,189,1106,566,676,361,
1080,70
6,589,1051,215,786,647,1121,348,419,1063,406,464,
680,1283,801,362,1108,590,409,1162,570,788,597,11
69,572,2
19,1285,311,708,1053,598,601,1067,651,421,792,112
2,802,611,1539,602,410,1112,231,688,1164,653,248,
1054,36
9,190,364,1170,654,659,1095,335,480,1286,315,221,
1289,370,613,1185,422,425,1600,451,614,1069,543,2
35,1124,
412,343,372,1664,775,317,1075,222,426,1172,453,23
7,1070,559,833,1099,804,712,1290,834,661,1297,808
,779,15
41,617,1128,604,433,1186,720,816,1077,836,347,121
7,897,243,1176,662,454,1101,318,675,1188,618,898,
1792,78
1,376,1292,428,1298,665,736,1542,567,840,1078,625
,238,1107,359,457,1081,399,787,1545,591,1136,678,
434,115
9,677,349,1102,245,458,1313,666,1218,620,363,1109
,127,191,1300,782,1546,407,436,1082,626,571,1192,
465,116
3,681,246,1123,707,350,1110,599,1084,668,790,1304
,460,249,1113,682,1314,573,411,1553,803,789,1548,
709,122
0,365,440,1165,628,1125,689,374,1171,423,466,1200
,793,1166,250,371,1554,481,1345,574,413,1055,603,
1224,36
6,468,1114,655,1569,900,805,1316,615,1346,684,710
,1556,429,1287,794,252,1173,373,1126,605,848,1129
,690,13
28,713,1320,632,482,1187,806,1116,427,904,1071,41
4,1291,223,663,1409,692,1570,835,1348,619,472,123
2,455,1
410,796,809,1174,714,1177,721,1189,837,716,1130,8
64,1079,810,1352,606,912,1560,722,1601,696,1572,3
77,435,
1137,817,1178,319,1103,621,1293,812,484,1132,430,
1602,838,1248,667,488,1190,239,1543,378,1576,459,
1219,62
2,627,1294,437,1665,380,1547,818,1299,461,496,160
4,669,1315,679,1083,724,1193,841,629,1584,351,113
8,467,1
301,438,1180,737,1111,251,1221,462,442,1140,441,1
194,469,1085,247,1555,683,1549,842,1666,738,899,1
305,670,
1302,783,1550,849,1201,820,1317,728,1412,928,111
5,791,367,1608,901,1793,630,1222,685,1196,844,114
4,633,1
225,711,1360,253,1086,691,1306,824,1167,902,1127,
686,740,1202,850,1318,375,1117,444,1668,470,1226,
483,161
6,415,1347,485,1416,905,1321,795,1794,473,1131,63
4,1204,744,1175,852,1233,960,1308,865,1672,693,11
18,797,
1228,906,1322,715,1424,807,1632,474,1376,636,134
9,694,1557,254,1179,717,1234,575,1329,913,1571,79
8,1324,8
11,1133,379,1208,697,1558,431,607,489,1561,866,11
39,723,1191,486,1249,908,1350,718,1330,813,1796,4
76,1181,
856,1680,839,1353,725,1134,698,1141,914,1236,752,
1195,868,1800,819,1354,814,1250,439,1573,929,156
2,490,1
411,623,1332,671,1240,739,1440,916,1295,463,1303,
843,1182,381,1361,497,1574,930,1696,821,1142,726,
1356,16
03,961,1564,872,1413,492,1197,631,1145,729,1577,7
00,1223,443,1808,741,1203,845,1252,920,1362,382,1
336,822,
1728,1414,851,1198,730,1578,498,1605,880,1417,74
2,1307,445,1146,471,1472,1377,635,1585,932,1227,6
87,1087,
903,1364,825,1418,500,1551,1606,846,1580,745,120
5,826,1319,732,1309,446,1256,1148,962,1229,936,12
06,475,
1667,853,1586,867,1310,1609,637,1323,907,1378,48
7,1235,695,1425,1209,746,1420,828,1368,753,1610,8
54,1669,
1617,857,1559,504,1264,799,1230,1119,255,1351,96
4,1588,909,1824,719,1426,1380,477,1331,915,1325,6
38,1441,
1237,748,1592,944,1856,869,1612,1210,491,1670,69
9,1428,1251,754,1920,858,1618,478,1442,1326,968,1
673,383,
1795,910,1384,1563,815,1135,976,1355,1238,870,13
33,917,1212,1473,727,1241,493,1432,873,1633,1620,
701,157
5,931,1674,1253,756,1183,860,1444,1334,499,1565,7
31,1797,1634,823,1681,922,1357,1143,874,1624,918,
1363,12
42,502,1392,933,1676,1254,743,1415,1337,760,1474,
881,1566,1358,494,1257,702,1579,1798,921,1199,50
1,1147,1
682,876,1636,1365,847,1801,992,1244,1338,447,144
8,1419,733,1697,827,1607,1379,934,1311,1207,882,1
258,937,
1149,1581,963,1684,1640,747,1366,505,1340,1265,8
55,1802,1587,924,1369,734,1476,1421,829,1427,123
1,965,16
98,1582,938,1809,1456,884,1381,506,1211,1260,749,1688,1648,945,1611,1804,966,1729,1150,755,1266,859,1589,
1422,940,1370,1480,830,1382,1429,911,1327,1593,871,1268,1619,639,1213,1590,888,1700,1385,479,1730,1613,9
46,1239,750,1810,1671,969,1372,1443,508,1430,1488,861,1704,1825,757,1386,1614,970,1433,1594,919,1812,162
1,1596,875,1243,1335,862,1732,1622,758,1625,1675,948,1445,1816,977,1826,1635,923,1626,1434,972,1255,1712,
761,1677,1272,877,1393,1214,1388,952,1678,1683,495,1359,1504,703,1339,1245,935,1394,1637,978,1446,1449,1
475,883,1638,1567,762,1259,1436,503,1367,1396,925,1799,1341,1246,878,1450,1477,735,1261,1583,1857,993,18
28,1736,885,1858,1685,939,1832,1803,1641,994,1628,1457,980,1744,1840,1860,926,1371,1921,764,1267,1686,14
78,941,1342,1699,967,1642,1922,1805,886,1400,1452,831,1689,1760,1591,947,1864,1649,507,1262,1383,1481,88
9,1423,1811,1615,984,1702,1458,751,1701,1373,1269,942,1482,1690,1644,996,1387,1151,1215,971,1806,1431,89
0,1460,1650,1595,509,1489,1705,1270,949,1731,1374,1623,973,1692,1814,1484,1000,1273,1706,1597,892,1435,1
827,1813,950,1733,1389,1464,863,1652,1713,1398,759,1447,1490,1817,1008,1274,1395,1505,510,1598,1437,1627,
979,1390,1492,1679,953,1924,1829,1639,763,1708,1734,1453,974,1818,1276,1397,1629,954,1872,1714,1737,879,
1656,1506,1830,981,1451,1928,1438,982,1247,1687,1716,1859,927,1643,1496,1479,995,1820,1833,1738,1745,765,
1861,1740,1888,956,1834,1630,1936,1746,887,1720,1401,1459,1841,985,1343,1645,1836,997,1508,1454,1862,16
91,986,1512,1263,1402,1483,943,1646,1651,1461,1404,891,1842,1485,1520,1693,998,1703,1748,1865,766,1653,1
375,1491,1462,511,1761,1275,1486,1466,1465,988,1493,1271,1707,1866,1001,1762,1923,1694,1807,951,1873,184
4,1752,1952,1002,1815,1391,1925,1654,1709,893,1868,1657,1735,1277,975,1715,1848,1926,1710,894,1764,1874, 1399,1468,1494,1009,1507, 1439,1509,1929, 1819,955,1497,1658, 1768, 1876,1984,1004, 1889,1717,1821, 1930, 1010, 1739,1831,1498,1660,1718,957,1278,1741,1599,1937,1822,983,1835,1403,1721,1455,1631,1513,958,1890,1747,15
10,1932,1742,987,1837,1500,1880,1863,1749,1012,1722,1938,1776,1892,1843,1838,999,1463,1953,1514,1647,169
5,1763,1016,1940,1487,1867,1405,1521,767,1954,1845,1750,1985,1896,1516,1655,989,1753,1724,1467,1765,1869,
1944,1003,1406,1846,1875,1754,1522,1904,990,1766,1469,1495,1659,1956,1711,1927,1005,1849,1524,1870,1769,
1850,1756,1470,959,1986,1960,1499,1877,1891,1661,1931,1011,1511,1719,1770,1852,1777,1878,1881,1013,1528,
1823,1279,1988,1933,1743,1501,1939,895,1662,1772,1968,1893,1515,1723,1778,1882,1006,1502,1992,1407,1934,
1839,2000,1894,1941,1014,1751,1517,1897,1725,1955,1780,1884,1523,1755,1017,1847,1946,1898,1942,1526,195
7,1767,1784,1905,1018,1518,1726,1945,1525,1900,1871,2016,1471,1757,1851,991,1958,1906,1961,1987,1771,152
9,1879,1948,1758,1853,1020,1989,1962,1908,1530,1773,1969,1990,1779,1883,1964,1854,1935,1007,1895,1663,19
12,1503,1970,1774,1993,1532,1885,1781,1994,1943,1015,1899,1886,1782,1972,2001,1947,1996,1785,1901,1976,1
519,1727,1959,2002,1019,1907,1786,1527,1949,1902,1759,2017,1909,1963,2018,2004,1950,1788,1965,1991,1021,
1910,1855,1971,1531,1913,2008,1775,1966,2020,1995,1914,1533,1973,1997,2024,1916,1974,1887,1783,1022,203
2,1534,2003,1977,1787,1998,1978,1903,2005,2006,1951,2019,1789,1980,1911,2009,2021,2010,1967,1915,2022,17
90,1535,1023,2012,2025,1975,2026,1917,1999,1918,2033,1979,2028,2034,1981,2007,1982,2011,2036,2023,2040,1
791,2013,2027,2014,2029,1983,2035,2037,1919,2030,2038,2041,2042,2015,2044,2031,2039,2043,2045,2046,20471

**Sequence group 3: Z3_2048**

[0,1,2,7,3,8,12,25,4,11,14,29,17,34,36,79,5,13,15,33,20,40,49,84,23,48,44,91,59,100,106,170,6,18,22,42,
24,47,53,93,30,57,61,101,74,113,119,187,35,63,77,117,82,126,136,199,90,138,149,224,155,236,257,366,9,19,27,5
6,31,60,73,108,37,78,65,120,87,130,143,207,46,76,89,137,95,146,154,231,104,157,173,247,186,264,280,404,55,92,
102,153,115,164,180,260,124,181,198,273,210,296,311,436,141,205,228,300,234,312,334,463,253,341,360,485,37
8,505,540,721,16,26,32,75,41,81,85,142,50,88,96,152,105,163,167,259,58,97,107,165,118,179,195,275,129,196,20
6,290,230,307,329,453,67,111,125,185,131,197,213,3

01,150,226,235,315,252,340,354,483,166,244,261,346,274,37 3,381,502,297,392,420,531,441,557,613,722,71,127,145,216,161,232,251,344,171,254,266,365,281,380,402,522,19 3,277,291,390,313,415,438,566,324,444,467,588,491,623,644,818,212,303,318,424,348,451,471,606,377,479,503,6 35,532,648,697,870,401,513,542,674,554,713,735,914,610,746,771,905,797,950,1007,1188,21,38,43,94,51,98,109, 178,52,110,121,188,133,208,218,327,66,122,134,221,147,229,242,328,156,240,258,359,278,376,385,501,69,144,15 8,223,175,245,262,375,184,271,282,387,294,413,429,552,183,292,305,411,323,440,455,590,350,474,493,622,511,6 42,679,856,80,169,176,268,191,287,304,405,201,310,317,437,335,462,478,619,255,330,349,466,367,489,510,638,3 95,517,546,671,570,711,738,897,286,362,389,499,410,529,549,699,433,561,578,719,614,758,781,936,469,612,625, 772,639,799,764,963,686,851,872,1019,881,1077,1108,1225,86,189,194,322,246,339,352,473,270,357,369,495,394, 520,545,702,284,391,409,521,423,550,573,726,445,581,604,751,637,777,816,971,326,414,428,571,454,597,628,76 6,494,629,645,813,688,794,863,1023,528,665,708,852,727,879,901,1059,759,910,908,1100,965,1123,1149,1303,36 1,442,475,631,518,647,677,828,547,700,714,874,745,885,907,1073,574,732,767,899,782,912,967,1125,826,979,10 01,1156,1039,1197,1220,1381,620,774,809,969,861,973, 1031, 1167,868,1025,1063,1211,1092,1242,1285,1439,886,1079,1117,1257,1138,1292,1272,1458,1183,1324,1346,1513,1392,1543,1579,1673,28,45,54,103,62,123,135,214,68, 139,148,220,160,238,243,370,70,159,168,237,177,288,298,400,202,299,321,434,338,457,477,634,72,174,190,293, 204,319,332,449,215,343,355,481,372,506,525,650,227,364,383,516,406,543,559,693,416,553,583,730,587,750,77 6,1011,112,203,211,336,222,356,371,498,249,386,396,536,419,564,580,705,267,399,427,556,447,585,593,740,465, 594,603,779,664,801,844,1024,285,446,459,601,487,626,632,789,509,662,682,825,718,858,876,1065,535,696,729, 877,761,895,940,1094,808,946,981,1128,1003,1163,1201,1375,116,219,239,382,265,397,422,568,279,431,450,596, 470,609,616,784,309,461,486,617,507,657,676,819,533,690,716,867,742,888,923,1067,333,497,524,680,560,710,7 07,890,575,734,748,916,791,942,958,1132,607,763,804,952,821,991,1005,1169,849,1021,1047,1213,1098,1247,12 87,1442,351,539,563,737,591,756,792,948,654,806,833,997,838,1009,1035,1194,667,835,847,1029,892,1045,1085, 1240,931,1096,1115,1259,1147,1306,1332,1468,691,903,920,1069,959,1102,1121,1277,983,1143,1172,1322,1204,1 349,1386,1524,1051,1176,1216,1358,1252,1398,1414,1571,1280,1429,1455,1591,1492,1626,1668,1784,132,250,27 2,432,306,458,482,641,316,490,514,660,538,685,724,925,345,527,567,703,584,754,743,935,598,769,796,977,830,9 93,1015,1185,408,577,600,753,653,787,811,999,659,831,842,1017,860,1037,1057,1230,668,854,883,1055,929,108 3,1110,1262,954,1136,1145,1308,1174,1335,1366,1506,418,651,656,823,670,837,865,1043,694,894,918,1075,944, 1104,1141,1298,802,927,961,1113,985,1158,1178,1327,1041,1181,1218,1360,1254,1395,1411,1567,840,989,1027,1 160,1053,1208,1235,1372,1090,1244,1267,1408,1295,1432,1465,1604,1119,1282,1314,1452,1344,1475,1503,1635, 1378,1517,1539,1659,1559,1700,1710,1847,425,673,683,921,786,938,956,1134,814,975,995,1165,1033,1192,1227, 1369,845,1013,1049,1199,1071,1237,1269,1404,1106,1290,1264,1423,1330,1461,1489,1617,933,1061,1081,1249,1 130,1274,1311,1445,1154,1316,1341,1478,1363,1496,1528,1654,1206,1352,1384,1510,1417,1547,1563,1689,1436, 1587,1600,1722,1630,1739,1752,1822,987,1088,1152,1319,1190,1338,1355,1499,1223,1389,1401,1536,1426,1551, 1595,1705,1232,1420,1448,1583,1485,1608,1612,1745,1521,1640,1649,1758,1679,1792,1806,1896,1300,1472,148 2,1621,1532,1644,1664,1771,1555,1684,1694,1799,1728,1814,1856,1920,1575,1716,1733,1830,1764,1838,1865,19 33,1778,1875,1885,1948,1907,1964,1984,2008,10,39,64,140,83,151,182,283,99,172,200,308,225,337,347,526,114, 192,209,331,248,363,407,541,269,403,384,565,452,592,611,778,128,233,263,374,276,398,426,572,314,443,460,59 5,508,633,649,815,342,468,519,643,537,669,695,841,562,701,728,891,741,913,951,1133,162,241,295,439,320,456, 504,618,353,523,472,652,551,678,712,857,393,515,558,698,579,720,739,904,605,747,783,934,812,964,992,1187,4 35,569,599,736,636,762,800,957,663,803,839,980,862,1018,1046,1231,706,853,898,1028,909,1048,1084,1266,945,1095,1124,1293,1151,1317,1357,1534,217,289,325,512,368,534,544,709,412,555,582,733,608,760,770,955,448,586,615,765,646,798,832,984,675,834,855,1008,902,1040,1076,1253,480,627,666,810,681,836,869,1030,731,893,911,1052,943,1093,1114,1291,768,928,960,1103,982,1144,1155,1313,1020,1171,1210,1347,1238,1376,1434,1535,496,672,717,875,757,906,941,1099,780,947,968,1131,994,1153,1186,1337,827,986,1010,1168,1050,1203,1234,1385,1068,1241,1271,1409,1301,1444,1464,1613,866,1032,1058,1215,1105,1251,1276,1427,1150,1286,1315,1456,1348,1469,1514,1651,1184,1326,1359,1493,1373,1527,1546,1681,1431,1556,1576,1675,1597,1704,1740,1841,256,358,379,576,417,589,621,795,421,624,655,817,687,859,878,1072,476,658,689,884,723,900,924,1074,744,922,953,1122,988,1148,1161,1312,488,715,749,889,788,930,962,1146,807,976,996,1164,1016,1200,1222,1370,805,1012,1036,1198,1066,1236,1256,1410,1109,1279,1302,1443,1325,1463,1497,1641,530,775,790,972,824,1004,1034,1189,843,1044,1056,1233,1086,1265,1284,1440,949,1078,1107,1270,1135,1297,1323,1459,1175,1331,1364,1490,1390,1526,1549,1670,1002,1127,1166,1310,1196,1345,1367,1515,1228,1380,1399,1533,1435,1565,1584,1696,1273,1433,1446,1577,1460,1598,1570,1713,1504,1637,1652,1747,1658,1782,1800,1859,548,820,829,1064,932,1091,1112,1278,974,1120,1137,1305,1173,1334,1362,1518,998,1170,1195,1336,1214,1368,1393,1538,1243,1402,1425,1560,1457,1581,1611,1718,1070,1202,1221,1391,1255,1418,1449,1572,1304,1450,1466,1609,1505,1594,1646,1749,1343,1484,1523,1638,1540,1657,1672,1772,1566,1678,1677,1795,1714,1808,1821,1893,1126,1239,1281,1451,1333,1467,1495,1620,1365,1516,1529,1653,1554,1661,1676,1780,1394,1544,1573,1671,1585,1680,1715,1809,1619,1723,1736,1825,1760,1845,1857,1924,1441,1578,1606,1717,1645,1719,1755,1831,1650,1751,1774,1852,1790,1867,1886,1944,1662,1783,1804,1873,1816,1889,1880,1951,1839,1902,1911,1968,1928,1976,1986,2007,302,388,430,602,464,661,692,871,484,704,725,882,755,917,926,1139,492,752,773,915,793,1006,1022,1182,846,1026,1062,1229,1089,1258,1283,1454,500,785,822,1014,850,1060,1080,1248,873,1097,1116,1288,1142,1318,1340,1470,896,1129,1159,1329,1191,1361,1377,1509,1205,1371,1403,1542,1407,1558,1580,1742,630,848,864,1087,887,1118,1140,1309,937,1162,1177,1353,1209,1383,1400,1520,970,1180,1219,1374,1246,1406, 1413, 1550, 1268, 1415, 1424, 1582, 1483, 1599, 1632, 1750, 1000,1245,1261,1422,1296,1447,1453,1590,1321,1481,1500,1618,1531,1642,1655,1775,1351,1512,1541,1656,1568,1669,1698,1791,1605,1702,1724,1810,1737,1828,1848,1922,640,880,919,1157,966,1179,1212,1388,990,1224,1250,1416,1275,1430,1437,1586,1042,1263,1294,1438,1320,1477,1494,1614,1350,1507,1530,1648,1552,1663,1687,1776,1082,1307,1339,1498,1379,1525,1522,1665,1396,1545,1557,1682,1592,1699,1709,1812,1428,1569,1602,1706,1615,1730,1738,1832,1636,1748,1765,1853,1794,1869,1887,1945,1111,1356,1382,1548,1412,1564,1593,1703,1474,1603,1624,1734,1628,1741,1757,1844,1486,1625,1634,1754,1666,1763,1787,1866,1692,1793,1803,1874,1820,1894,1905,1954,1508,1674,1685,1777,1711,1796,1807,1882,1725,1818,1833,1901,1849,1912,1926,1971,1767,1835,1854,1915,1871,1930,1936,1983,1883,1941,1950,1989,1961,1997,2006,2027,684,939,978,1226,1038,1260,1289,1462,1054,1299,1328,1480,1354,1502,1537,1688,1101,1342,1387,1519,1405,1562,1553,1695,1419,1574,1596,1721,1622,1731,1744,1840,1193,1397,1421,1561,1473,1589,1607,1735,1479,1623,1631,1746,1643,1759,1770,1861,1487,1639,1660,1769,1691,1786,1801,1876,1707,1815,1819,1895,1834,1906,1918,1966,1207,1471,1476,1616,1488,1627,1647,1762,1511,1667,1683,1781,1701,1797,1817,1891,1601,1690,1712,1802,1726,1826,1836,1903,1761,1837,1855,1916,1872,1929,1935,1982,1629,1729,1753,1827,1768,1851,1863,1921,1789,1868,1878,1934,1890,1942,1953,1992,1805,1884,1898,1949,1910,1956,1965,1999,1923,1969,1975,2004,1980,2013,2015,2035,1217,1491,1501,1686,1588,1697,1708,1813,1610,1720,1732,1829,1756,1843,1860,1919,1633,1743,1766,1846,1779,1864,1879,1932,1798,1888,1877,1939,1904,1952,1960,1995,1693,1773,1785,1870,1811,1881,1897,1946,1824,1899,1909,1957,19

17,1962,
1972,2003,1850,1913,1925,1967,1937,1977,1981,201
1,1943,1988,1991,2017,1998,2020,2022,2032,1727,1
788,182
3,1900,1842,1908,1914,1963,1858,1927,1931,1974,1
940,1978,1990,2014,1862,1938,1947,1987,1959,1993
,1994,20
21,1970,2000,2002,2023,2009,2028,2030,2040,1892,
1955,1958,1996,1973,2001,2005,2025,1979,2010,201
2,2029,2
018,2031,2036,2042,1985,2016,2019,2033,2024,2034
,2037,2043,2026,2038,2039,2044,2041,2045,2046,20
47]

**Sequence group 3: Q3_4096**

[0,1,2,4,8,16,32,3,5,64,1024,2048,9,6,17,10,1
8,128,12,33,65,20,256,34,24,36,7,129,66,512,11,40,6
8,130,
19,13,48,14,72,257,1025,21,132,35,258,26,2049,513,
80,37,25,22,136,260,264,38,514,96,67,41,144,28,69,4
2,516,4
9,1026,74,272,160,520,288,528,192,544,70,44,131,81
,2050,50,73,15,320,133,52,1028,23,134,384,76,137,8
2,56,27,
97,39,259,84,138,145,261,1032,29,43,2052,98,515,88
,140,30,146,71,262,265,161,576,45,1040,100,640,51,
148,46,7
5,266,273,517,2056,104,162,53,193,1056,152,77,164,
768,268,274,518,54,83,57,521,1027,112,135,2064,78,
289,194,
85,276,522,58,168,1029,139,99,86,60,280,89,290,529
,2080,524,196,1088,141,101,147,176,142,530,321,31,
200,10
33,90,545,292,2051,322,532,263,149,102,105,1030,3
04,296,163,92,47,267,385,546,2053,324,1041,208,38
6,150,15
3,165,106,55,1034,328,536,577,548,2112,113,154,79,
269,1042,108,578,224,166,519,552,195,1152,270,307
2,641,5
23,275,580,291,59,1036,169,560,114,277,156,2057,8
7,197,1057,116,170,61,531,525,642,281,1089,278,52
6,2054,1
77,293,388,91,1044,584,769,198,172,120,201,2065,3
36,1280,62,282,143,103,178,294,1058,93,644,2058,2
02,592,3
23,1048,392,297,770,107,180,151,1060,2066,209,284
,648,94,204,298,1031,400,608,352,2176,325,533,115
3,155,21
0,305,547,300,1090,109,2060,184,534,537,115,167,1
536,225,326,306,772,2081,157,1035,656,329,110,117
,212,106
4,171,2113,776,330,226,549,1092,538,387,308,216,2
068,1154,416,271,279,158,337,1043,550,672,2304,11
8,332,57
9,1037,540,389,173,121,1072,2082,553,199,784,179,
1038,228,338,312,2072,704,390,1096,174,554,581,39
3,1281,2
83,2084,122,448,353,1045,561,203,63,340,2055,1156
,394,527,582,556,181,1059,2177,295,285,232,124,12
82,205,1
82,643,2114,562,1050,286,585,299,1537,354,211,256
0,401,185,1104,396,344,586,645,2059,1061,593,535,
240,206,
1049,95,2088,327,564,1046,800,402,356,307,2116,11
60,301,417,213,568,1284,832,2178,588,186,1288,646
,404,22
7,896,2067,1062,594,418,302,1538,649,771,2061,360
,539,1120,111,331,214,1091,2096,309,188,449,1065,
217,408,
2062,609,596,1168,551,650,229,1052,2120,159,420,3
10,1093,541,773,2305,610,1066,657,333,119,1540,30
73,600,
339,218,1073,368,652,230,2069,1098,391,313,450,12
96,542,2180,334,233,1184,555,774,175,2083,1544,12
3,658,6
12,1312,2306,341,777,220,1552,314,424,2074,395,12
16,673,583,355,1568,2561,287,183,234,1094,125,557
,2128,6
60,1068,616,342,316,2085,1155,241,778,1105,563,34
5,2073,452,1074,397,403,207,2070,1097,674,558,103
9,785,4
32,2184,357,1344,187,236,664,2308,1157,624,587,10
76,780,2312,705,126,1047,242,565,1158,2086,398,34
6,456,1
408,358,2562,405,1100,303,569,244,2144,1161,595,1
89,1106,566,2115,676,361,1080,706,589,2089,1051,2
15,786,
647,1121,2192,348,419,1063,406,464,2076,680,1283,
801,362,1108,2117,590,409,1162,570,2090,788,597,1
169,572 ,219,2564,1285,311,708,1053,598,2097,601,
1067,651,421,3074,792,1122,802,611,1539,2122,602,
410,1112,231,68
8,2320,1164,653,248,1054,2208,369,190,364,1170,65
4,2568,659,1095,335,480,2336,1286,315,221,1289,25
76,370,
613,1185,422,425,2240,1600,451,614,1069,2592,543,
235,1124,412,2118,343,372,1664,775,317,2092,1075,
222,426 ,1172,2179,453,237,1070,559,2129,833,1099
,804,712,2098,1290,834,661,1297,2121,808,779,1541
,617,1128,2063,
604,433,1186,720,2368,816,1077,836,347,2181,1217,
897,243,1176,2100,662,454,1101,318,3076,675,1188,
618,898 ,2071,1792,781,376,2182,1292,428,1298,665
,2432,736,1542,567,840,2124,1078,625,238,1107,218
5,359,457,1081,
399,2130,787,1545,591,1136,2104,678,434,1159,207
5,677,349,1102,245,2145,458,1313,666,1218,2087,62
0,363,11
09,2307,127,191,1300,782,2132,1546,407,436,1082,2
186,626,571,1192,2193,465,1163,681,246,2309,1123,
707,350 ,3080,1110,599,1084,668,2077,790,1304,460
,2091,249,1113,682,1314,2146,573,411,1553,2563,80
3,789,1548,709,
2136,1220,365,440,2188,1165,628,1125,689,2078,37
4,1171,423,2194,466,1200,793,2119,1166,250,371,15

54,2310,
481,1345,574,2313,413,1055,603,2209,1224,366,468,
1114,2624,655,1569,900,2093,805,1316,615,3088,13
46,684,7
10,2148,1556,429,1287,2688,794,252,1173,373,2099,
1126,605,848,2196,1129,690,1328,2094,713,1320,63
2,2123,4
82,1187,806,2314,1116,427,904,2321,1071,414,1291,
2565,223,663,1409,2152,692,1570,835,2210,1348,61
9,472,21
01,1232,455,1410,2241,796,809,1174,3104,714,1177,
721,2200,1189,837,716,2125,1130,864,1079,2212,81
0,1352,6
06,2816,912,1560,722,2316,1601,696,1572,2322,377,
435,1137,2566,817,1178,319,2102,1103,621,1293,21
31,812,4
84,1132,2105,430,1602,838,2569,1248,667,3075,488,
1190,239,2160,1543,378,1576,2183,459,1219,622,21
26,627,1
294,437,2337,1665,380,2242,1547,818,1299,2133,46
1,496,1604,2324,669,1315,2570,679,1083,724,2106,1
193,841,
629,2216,1584,351,1138,3077,467,1301,2187,438,11
80,737,2147,1111,251,1221,2134,462,442,2108,1140,
441,1194 ,2328,469,1085,2137,247,1555,683,2338,15
49,842,1666,2577,738,899,2572,1305,670,1302,2244,
783,1550,3136,84
9,1201,820,2189,1317,728,2149,1412,928,1115,2195,
791,367,2224,1608,901,1793,2190,630,1222,2578,68
5,1196,8
44,2369,1144,633,2079,1225,711,1360,2248,253,108
6,3081,691,1306,824,2138,1167,902,2593,1127,686,7
40,2340,
1202,850,2370,1318,375,2580,1117,444,1668,2311,4
70,1226,2197,483,1616,415,2150,1347,485,2153,141
6,905,30
78,1321,795,1794,2352,473,1131,2344,634,1204,221
1,744,1175,852,2140,1233,960,2095,1308,865,2315,1
672,693,
2433,1118,797,1228,2594,906,1322,2372,715,1424,3
089,807,1632,474,2256,1376,636,2434,1349,694,219
8,1557,2
54,2201,1179,717,2213,1234,575,1329,2154,913,157
1,2103,798,1324,3082,811,1133,2376,379,1208,2584,
697,155
8,431,2625,607,489,2596,1561,866,2161,1139,723,22
02,1191,486,2127,1249,908,2317,1350,718,1330,309
0,813,17
96,2156,476,1181,2626,856,1680,2272,839,1353,221
4,725,1134,2567,698,1141,2600,914,1236,2243,752,1
195,320
0,868,1800,2318,819,1354,2689,814,1250,439,2571,1
573,929,2323,1562,490,2628,1411,623,2339,1332,67
1,2107,1
240,739,3084,1440,916,2217,1295,463,2608,1303,84
3,2162,1182,381,2325,1361,497,2204,1574,930,2135,
1696,82
1,2245,1142,726,3105,1356,1603,2164,961,2218,156
4,872,2109,1413,492,2579,1197,631,2573,1145,729,2
690,157
7,700,2329,1223,443,3137,1808,741,2326,1203,845,2
574,1252,920,2225,1362,382,2341,1336,822,2436,17
28,2139,
1414,851,3092,1198,730,2632,1578,498,2817,1605,8
80,2246,1417,742,2220,1307,445,2168,1146,2249,47
1,1472,2
384,1377,635,3328,1585,932,2110,1227,687,2330,10
87,903,2191,1364,2151,825,1418,2226,500,1551,234
2,1606,8
46,3106,1580,745,2141,1205,2692,826,1319,2250,73
2,1309,2640,446,1256,2371,1148,3096,962,1229,244
0,936,12
06,2345,475,1667,2818,853,2155,1586,867,2228,131
0,1609,2199,637,1323,3108,907,2257,1378,487,2332,
1235,69
5,2696,1425,2142,1209,746,2252,1420,828,2346,136
8,3079,753,1610,2448,854,1669,2656,1617,2400,857,
1559,23
73,504,1264,2581,799,3201,1230,1119,2203,255,135
1,2258,964,2353,1588,909,2595,1824,719,2348,1426,
3138,13
80,477,2157,1331,915,2232,1325,2582,638,1441,258
5,1237,2163,748,1592,2215,944,1856,3584,869,2273,
1612,12
10,2374,491,2354,1670,699,2820,1428,1251,2205,75
4,3083,1920,858,2704,1618,2377,478,1442,2158,132
6,968,21
65,1673,2260,383,1795,3112,910,2219,1384,1563,28
24,815,2378,1135,976,2274,1355,2597,1238,870,314
0,1333,2
586,917,1212,2435,1473,2356,727,1241,2264,493,32
02,1432,873,2464,1633,2319,1620,701,2327,1575,22
06,931,1
674,2385,1253,3091,756,1183,2598,860,2720,1444,1
334,2166,499,2380,1565,731,2627,1797,3085,1634,8
23,2588,
1681,2437,922,1357,2221,1143,2169,874,1624,3120,
918,2601,1363,2247,1242,502,2832,1392,2227,933,1
676,3086 ,1254,2276,743,1415,2386,1337,2360,760,2
752,1474,881,2438,1566,3144,1358,494,2222,1257,2
602,702,2629,157
9,1798,2441,921,3329,1199,501,2331,1147,2170,168
2,2496,876,1636,2401,1365,3093,847,1801,2609,992,
2251,12
44,2111,1338,447,2388,1448,3204,1419,2442,733,16
97,2575,827,2630,1607,2604,1379,934,2229,1311,31
07,1207,
2343,882,1258,2333,937,2280,1149,2172,1581,963,3
330,1684,2253,1640,2230,747,1366,2691,505,2610,1
340,3098 ,1265,855,2334,1802,2633,1587,2347,924,3
585,1369,734,2402,1476,2259,1421,2449,829,1427,2
233,1231,3152,96
5,2444,1698,2392,1582,938,2634,1809,2693,1456,31
09,884,1381,2641,506,2583,1211,2288,1260,2254,74
9,1688,3
097,1648,2143,945,2375,1611,2612,1804,966,3094,1

729,2848,1150,2450,755,2404,1266,859,2355,1589,3
208,1422 ,2349,940,2465,1370,2261,1480,830,2616,1
382,3332,1429,2880,911,2636,1327,1593,2234,871,3
336,1268,2694,16
19,2452,639,2275,1213,1590,2944,888,3110,1700,26
42,1385,2466,479,2350,1730,3586,1613,946,2697,12
39,2819,
750,2408,1810,2587,1671,3168,969,2159,1372,1443,
2379,508,2262,1430,3139,1488,2357,861,2236,1704,
2497,182
5,757,3113,1386,2265,1614,2456,970,2657,1433,264
4,1594,3216,919,2599,1812,1621,2698,1596,2277,87
5,3100,1
243,2207,1335,2468,862,2358,1732,3141,1622,2589,
758,1625,2821,1675,2658,948,3114,1445,2705,1816,
2381,977 ,2167,1826,3588,1635,2648,923,2387,1626,
2266,1434,972,3121,1255,2416,1712,2700,761,2278,
1677,3146,1272,2
439,877,2361,1393,2498,1214,3344,1388,2590,952,2
382,1678,2281,1683,495,3232,1359,2603,1504,2822,
703,2223 ,1339,3592,1245,2171,935,2706,1394,2660,
1637,3360,978,2389,1446,2825,1449,2268,1475,3600
,883,2362,1638,2
472,1567,2443,762,3264,1259,2721,1436,2631,503,2
403,1367,3616,1396,2335,925,2231,1799,2282,1341,
3142,124
6,2173,878,2605,1450,2708,1477,3116,735,2664,126
1,2390,1583,2364,1857,3203,993,2289,1828,2826,17
36,3153,
885,2611,1858,2393,1685,2500,939,3122,1832,2445,
1803,2451,1641,2255,994,3145,1628,2722,1457,2606
,980,308
7,1744,2833,1840,2480,1860,2405,926,3392,1371,22
35,1921,2284,764,2712,1267,3205,1686,2672,1478,2
635,941,
3124,1342,2828,1699,2753,967,2174,1642,3095,1922
,2290,1805,2613,886,1400,1452,3206,831,2446,1689,
2394,17
60,2504,1591,3456,947,2406,1864,2453,1649,3148,5
07,2351,1262,2617,1383,2292,1481,3209,889,2643,1
423,2237 ,1811,3154,1615,2614,984,2724,1702,2409,
1458,3128,751,2754,1701,2637,1373,3099,1269,2263
,942,2834,1482,2
695,1690,3169,1644,2396,996,2467,1387,3111,1151,
2454,1215,2512,971,2728,1806,3331,1431,2849,890,
2410,146
0,3156,1650,2638,1595,2457,509,3210,1489,2618,17
05,2836,1270,2645,949,3217,1731,2620,1374,2267,1
623,3333 ,973,2359,1692,2756,1814,3101,1484,2646,
1000,2649,1273,3115,1706,2699,1597,2469,892,2840
,1435,3170,1827,
2850,1813,2659,950,3587,1733,2650,1389,2458,1464
,3160,863,2279,2736,1652,3212,1713,2701,1398,229
6,759,31
02,1447,2417,1490,2238,1817,2412,1008,3218,1274,
2702,1395,2707,1505,3143,510,2383,1598,2528,3334
,1437,23
63,1627,2269,979,3337,1390,2418,1492,2661,1679,3
233,953,2470,1924,2473,1829,3648,1639,2499,2662,
763,3117 ,1708,2591,1734,2283,1453,3172,974,2460,
1818,2391,1276,2420,1397,3712,2823,1629,2365,954
,3123,1872,2270,
1714,2474,1737,3220,879,2501,1656,2285,3118,1506
,2607,1830,2881,981,3147,1451,2852,1928,2760,143
8,3338,2
882,982,2709,1247,3345,1687,2856,1716,2827,1859,
3589,927,2665,3176,1643,2652,1496,2481,1479,3234
,995,276
8,1820,2864,1833,3125,2884,1738,2395,1745,3265,7
65,2945,1861,2291,3224,1740,2710,1888,2502,956,3
149,1834 ,2366,1630,2723,3236,1936,2666,1746,294
6,887,3840,1720,2829,1401,2424,3340,1459,2476,18
41,3346,985,2713,
1343,2784,3590,1645,2615,1836,2888,997,3126,1508
,2673,2286,1454,3155,1862,2407,1691,2505,986,312
9,2447,1
512,2835,1263,3593,1402,2639,3184,1483,2726,943,
2482,1646,3207,1651,2725,2397,1461,3150,1404,229
3,891,25
06,3361,1842,2714,1485,3266,1520,2668,1693,2411,
3157,998,2175,1703,2239,1748,3348,2830,1865,3594
,766,245
5,1653,2484,3130,1375,2674,1491,2619,1462,3240,2
513,511,3211,1761,2729,1275,2294,3171,1486,2755,
1466,239
8,1465,3158,2647,988,3132,1493,2716,1271,2838,33
52,1707,2508,1866,2297,3161,1001,2730,1762,3362,
1923,262
1,2459,1694,3601,1807,2851,951,2837,3596,1873,27
57,1844,3268,2413,1752,2488,1952,3213,1002,2676,
3173,181
5,2737,1391,2422,3219,1925,2471,1654,2514,1709,3
248,2841,893,3214,1868,2298,2419,1657,3602,1735,
2529,339
3,1277,2622,975,2461,1715,3103,2651,1848,3272,19
26,2414,2516,1710,3162,894,2703,3617,1764,2948,1
874,2853 ,3364,1399,2663,1468,3394,2732,1494,275
8,1009,3604,2477,1507,3335,1439,2842,2300,1509,3
221,1929,2421,317
4,1819,2653,955,2896,3177,1497,2738,1658,3376,27
61,1768,3368,1876,2680,2530,1984,3235,1004,2854,
3164,188
9,2475,1717,2952,3119,1821,2462,1930,3339,2271,1
010,2711,1739,3457,2740,1831,3618,2883,1498,3396
,1660,26
67,2520,1718,3280,957,2503,3458,1278,2844,1741,2
857,3222,1599,2762,3225,1937,2769,1822,3237,2885
,983,276
4,1835,3178,2912,1403,3127,2858,1721,3400,1455,2
654,2960,1631,3608,1513,2770,3649,958,2744,3620,
1890,242
5,1747,2483,3185,1510,2865,3226,1932,2367,1742,3
151,2669,987,3341,2860,1837,2532,1500,3180,2478,
1880,365
0,2886,1863,3296,1749,2715,2536,1012,3238,2287,1
722,3591,1938,2426,3624,1776,2507,3267,1892,2670,1843,26
75,3342,1838,2485,3713,999,2428,1463,3595,2866,1
953,3347,2509,1514,2544,3652,1647,2717,1695,3363
,2727,17
63,3131,2772,1016,3241,2889,1940,2677,1487,3632,
2399,1867,3186,2515,1405,3349,2486,1521,3228,278
5,767,31
59,1954,2299,3269,1845,2510,2490,1750,3188,2489,
1985,3242,1896,2517,3133,1516,2295,3603,1655,273
1,3597,9
89,2890,3714,1753,2786,2947,1724,3353,1467,2718,
3350,1765,2831,3598,1869,2897,3249,1944,2868,336
5,1003,2
776,3460,1406,2976,3163,1846,2839,1875,2415,3656
,1754,2949,3841,1522,2678,3270,1904,2733,3244,99
0,2892,3
192,1766,2681,3273,1469,2759,3408,1495,2301,3134
,1659,2739,3354,1956,2872,3215,1711,2950,3175,19
27,2734,
1005,2788,3250,1849,2898,3366,1524,2423,3165,187
0,2492,3716,1769,2518,3274,1850,2531,3664,1756,2
463,339
5,1470,2533,3464,959,2953,3369,1986,2843,3842,19
60,2521,3179,1499,2682,3252,1877,2792,3223,1891,
2900,328
1,3008,1661,3356,2913,1931,3720,2741,1011,3166,2
845,1511,3276,2954,1719,3370,2763,1770,3472,2855
,1852,36
80,2522,1777,3424,2684,1878,3397,2742,1881,3605,
2302,1013,3227,2765,1528,3282,2623,3377,1823,296
1,3619,1
279,2846,3372,1988,2859,3181,1933,2427,3256,1743
,2745,3606,1501,2479,2655,2537,1939,3609,2914,89
5,3187,2
771,1662,3239,2534,1772,3297,2956,1968,3398,2766
,3378,1893,2861,3844,1515,2524,3229,1723,2904,37
28,1778,
2887,3401,1882,2773,3182,2746,1006,3189,2962,150
2,3284,2800,1992,3243,2916,3848,1407,2867,3402,1
934,286
2,3298,1839,2487,3621,2000,2977,3610,2538,1894,3
459,2671,1941,3380,2719,1014,3288,2787,3488,1751
,2964,33
43,1517,2511,3351,2891,1897,3230,2429,1725,3409,
2545,1955,3622,2978,3744,1780,2869,3190,1884,277
4,3404,1
523,3651,3009,3612,1755,2920,3461,1017,2540,3245
,2679,1847,3193,2777,1946,3625,2748,3271,1898,24
91,3856,
1942,2789,3251,2893,1526,3300,2968,1957,3410,243
0,3384,1767,2870,3776,1784,3462,2899,3246,1905,2
778,362
6,1018,2546,3653,2928,1518,3465,2790,1726,3355,2
493,3194,1945,2519,3520,1525,3425,2683,3633,1900
,2980,32
75,2735,1871,3135,2951,2016,3412,2873,3466,1471,
2548,3599,1757,3654,2894,3628,1851,2793,3253,287
4,991,33
67,2780,1958,3357,2494,3304,1906,3196,3010,3277,
1961,2984,3254,2523,1987,3715,2901,1771,3634,291
5,3358,1
529,3657,2685,3371,1879,2955,3426,2535,1948,3283
,2743,1758,3473,3257,2794,1853,3468,2876,3416,10
20,2801,
3658,2902,1989,3717,3665,1962,2905,3607,2552,190
8,3312,2847,3278,1530,3167,2303,3399,1773,3012,3
636,295
7,1969,3872,2767,3474,1990,3428,2525,3379,1779,2
963,3373,2686,1883,3489,3285,2796,1964,3640,2992
,3904,18
54,2917,3660,3258,1935,2539,3718,2747,1007,3476,
3299,2802,1895,3968,2906,3666,1663,2526,3490,337
4,1912,3
016,3721,2431,1503,3843,2958,3432,1970,3611,2863
,3183,1774,3024,3403,3286,1993,2918,3381,2965,15
32,3260,
3521,2775,1885,3289,2541,3480,1781,2921,3681,366
8,1994,2749,3623,2979,3722,1943,3301,2804,3231,1
015,290
8,3492,3382,1899,2547,3613,2779,1886,3845,3682,2
871,3729,1782,2970,3405,3191,1972,2922,3672,2966
,2001,34
11,3290,2550,1947,3440,2981,3724,3302,1996,2791,
3463,3385,1785,2808,3522,2929,1901,3614,3406,254
2,3305,1
976,2750,3627,3846,1519,2969,3247,2549,3195,1727
,3730,2924,3684,1959,3413,2895,3849,3040,2002,32
92,3386,
2495,1019,3496,3467,2781,3745,1907,2875,3655,342
7,1786,2982,3359,3255,2930,1527,3306,2985,3197,1
949,362
9,3011,3732,3688,1902,2795,3414,2553,3388,1759,3
313,2903,3850,2017,3635,2972,3417,2782,1909,3524
,3469,28
77,3475,1963,3279,3013,3746,2018,3630,2986,3857,
3504,2004,2932,3429,2554,3259,1950,3308,2797,373
6,3696,1
788,2993,3659,3852,3014,1965,3777,3198,2803,3314
,1991,2907,3637,3470,2988,1021,3418,3528,2878,19
10,3430,
3477,2959,3375,1855,3641,2919,3316,3667,1971,268
7,3261,3638,2936,1531,3748,3433,2527,3778,1913,3
661,299
4,3287,2798,3858,2008,3719,3017,3420,3491,1775,2
556,3478,3536,2909,1966,3752,3873,2805,3434,2020
,3662,30
18,3481,3642,1995,2967,3860,3669,3644,2923,1914,
3291,3383,2910,3780,1533,3670,2806,3673,3723,197
3,2996,3
493,3864,3025,3874,1997,3683,2971,3674,3482,2024
,3020,3303,3760,2809,1916,3725,3320,2925,3441,32
62,1974,
3436,3000,3726,3731,1887,2543,3407,3552,2751,338
7,1783,3293,2983,3442,3685,3026,1022,3494,3497,3
523,293
1,2032,3686,3615,2810,3307,3484,1534,2551,3415,3

444,2973,3847,2003,3389,3294,2926,3498,3525,1977,2783,3309,3631,3905,1787,3041,3876,3784,2933,3906,1998,3733,2987,3880,3851,3689,1978,3042,3676,3505,3028,3792,1903,3888,3908,2974,3419,3969,2005,2812,3315,3734,3526,2989,2006,3390,3747,3015,3690,3970,1951,3853,2934,3448,3500,2879,3737,2019,3808,3639,2995,3912,3697,1789,2555,3310,3431,3529,2937,1980,3471,3859,3663,3032,3750,3506,1911,2799,3749,3421,3317,2990,2009,3530,3738,3692,3044,3435,3199,2021,3263,3019,3854,3479,2938,2010,3508,3698,3643,2557,3537,3753,1967,3318,2997,3779,3422,3671,3021,1915,3740,3862,3532,3048,3321,3754,2022,3645,2940,3483,3875,3861,1790,2998,3781,3437,3512,2911,3700,1535,3761,3446,2807,3495,3538,3865,3056,1023,3322,3443,3553,2558,3646,3485,2012,3675,3027,3438,3540,3727,3001,2025,3972,3877,3687,2811,3756,3782,1975,3501,3022,3866,3324,3445,3677,3002,2026,3920,3762,3785,2927,3704,3554,1917,3878,3029,3499,3976,3486,3030,3295,1999,3735,3764,3907,2975,3691,3544,3527,1918,3043,3868,3881,3786,3793,2813,3909,2033,3788,3936,3004,3882,3678,3984,3794,1979,2935,3768,3449,3507,3889,3033,3391,2028,3693,3884,3045,3556,3502,3910,3739,2034,3034,3560,3311,3450,3531,2991,3694,1981,3699,3509,3452,2939,3890,3533,3568,3741,2007,3046,3751,3796,3913,2814,3701,3423,3539,1982,3510,2559,3809,3323,3534,3514,3513,2011,3036,3541,3319,3755,3914,3049,3810,3971,3742,2036,3855,2999,3921,3892,3800,4000,3050,3863,2023,3439,3973,3702,3757,2941,3916,3705,3783,2040,3325,3023,3763,3896,3974,3758,2942,3812,3922,1791,3447,3516,3542,3057,3555,3487,3557,3977,3867,2013,3003,3545,3706,3816,3924,4032,3052,3937,3765,2027,3869,3978,3058,3787,3879,3546,3708,3766,3005,2014,3326,3789,3647,3985,3870,3031,3883,3451,3769,3503,2029,3679,3561,3006,3938,3795,3558,3980,3790,3035,3885,1983,3548,3928,3911,3797,3060,3770,3986,3824,3940,3891,2035,3886,3047,3511,4001,3562,3695,3743,3811,3064,3988,3535,2037,3915,3453,3569,2815,4002,3893,3798,4033,3944,3564,3703,1919,3037,3801,3772,3515,3813,3917,3992,3051,3454,3894,3923,3802,2030,3570,3952,3038,3814,3517,3543,3707,4004,3759,3975,3053,3897,2038,3572,3918,3817,3898,3804,3518,3007,4034,4008,3547,3925,3939,2041,3709,3979,3059,3559,3767,3818,3900,3825,3926,3929,3061,3576,3871,3327,2042,4036,3981,3791,3549,3987,2943,3710,3820,4016,3941,3563,3771,3826,3930,2015,3054,3550,4040,3455,3982,3887,4048,3942,3989,3062,3799,3565,3945,3773,4003,2044,3828,3932,3571,3803,3065,3895,3994,3946,3990,3574,4005,3815,3832,3953,3066,3566,2031,3774,3993,3573,3948,3919,4064,3519,3805,3899,3039,4006,3954,4009,4035,3819,3577,3927,2039,3996,3806,3901,3068,4037,4010,3956,3578,3821,4017,4038,3827,3931,4012,3902,3983,3055,3943,3711,3960,2043,3551,4018,3822,4041,3580,3933,3829,4042,3991,3063,3947,3934,3830,4020,4049,3995,4044,3833,3949,4024,3567,2045,3775,4007,4050,3067,3955,3834,3575,3997,3950,3807,4065,3957,4011,4066,4052,3998,3836,4013,4039,3069,3958,3903,4019,3579,3961,2046,4056,3823,4014,4068,4043,3962,3581,4021,4045,4072,3964,4022,3935,3831,3070,4080,3582,4051,4025,3835,4046,4026,3951,4053,4054,3999,4067,3837,4028,3959,4057,4069,2047,4058,4015,3963,4070,3838,3583,3071,4060,4073,4023,4074,3965,4047,3966,4081,4027,4076,4082,4029,4055,4030,4059,4084,4071,4088,3839,4061,4075,4062,4077,4031,4083,4085,3967,4078,4086,4089,4090,4063,4092,4079,4087,4091,4093,4094,4095]

**Sequence group 3: Z3_4096**

[0,1,2,7,3,8,13,26,4,12,15,30,18,35,37,82,5,14,16,34,21,41,51,87,24,50,45,94,61,103,110,177,6,19,23,43 ,25,49,55,96,31,59,63,104,76,117,123,195,36,65,80,121,85,131,141,208,93,143,155,235,161,248,271,391,9,20,28,58,32,62,75,112,38,81,67,124,90,135,149,217,48,78,92,142,98,152,160,243,108,163,180,260,194,278,296,434,57,95,106,159,119,171,188,274,129,189,207,288,220,313,330,471,146,215,239,318,246,331,356,502,266,363,385,528,405,551,593,816,17,27,33,77,42,84,88,147,52,91,99,158,109,170,174,273,60,100,111,172,122,187,204,290,134,205,216,307,241,326,350,491,69,115,130,193,136,206,223,319,156,237,247,334,265,362,378,525,173,257,275,369,289,399,408,548,315,421,453,582,477,613,681,817,73,132,151,226,168,244,264,367,178,267,281,390,297,407,4

32,571,202,293,308,418,332,447,473,624,344,480,507,650,535,693,719,942,222,321,338,457,371,488,511,672,404,521,549,708,583,724,785,1011,431,561,595,756,609,805,833,1072,677,848,880,1059,914,1122,1203,1479,22,39,44,97,53,101,113,186,54,114,125,196,138,218,228,348,68,126,139,232,153,240,254,349,162,252,272,383,294,403,413,547,71 ,150,164,234,182,258,276,402,192,286,298,415,311,445,463,607,191,309,323,442,343,476,493,653,373,515,537,692,558,716,762,992,83,176,184,283,200,304,322,436,210,329,337,472,357,501,520,688,269,351,372,506,392,533,557,712,424,565,600,752,629,803,837,1048,302,387,417,544,441,580,603,788,468,618,638,813,682,863,893,1102,509,680,696,881,713,916,871,1140,771,986,1014,1221,1026,1306,1353,1539,89,197,203,342,259,361,376,514,285,381,395,540,423,569,599,791,300,420,440,570,456,605,632,822,481,642,670,854,710,888,939,1151,347,446,462,630,492,661,699,873,538,700,720,935,774,910,1002,1226,578,745,799,987,823,1023,1054,1279,864,1066,1063,1341,1143,1376,1417,1670,386,478,516,703,567,723,760,955,601,789,807,1017,846,1032,1062,1300,633,830,875,1051,894,1069,1146,1380,952,1163,1194,1428,1250,1493,1531,1810,689,884,930,1149,999,1154,1238,1445,1009,1229,1285,1516,1329,1567,1639,1919,1033,1309,1367,1592,1400,1651,1617,1957,1471,1707,1746,2065,1830,2125,2198,2406,29,47,56,107,64,127,140,224,70,144,154,231,167,250,255,396,72,165,175,249,185,305,316,430,211,317,341,469,360,495,518,707,74,181,198,310,213,339,353,486,225,366,379,523,398,552,575,726,238,389,411,564,437,596,615,780,448,608,644,827,649,853,886,1209,116,212,221,358,233,380,397,543,262,414,425,588,452,621,641,795,282,429,461,612,484,647,656,840,505,658,669,890,744,919,976,1228,301,483,498,666,530,697,704,903,556,741,766,951,812,995,1019,1288,587,784,826,1021,867,1045,1108,1332,928,1116,1166,1384,1197,1439,1500,1799,120,230,251,409,279,426,455,626,295,465,487,660,510,676,684,897,328,500,529,686,554,735,759,943,584,776,809,1007,842,1036,1084,1291,354,542,574,764,617,802,798,1039,635,832,850,1074,906,1111,1133,1390,673,869,923,1125,946,1180,1200,1448,983,1224,1262,1519,1338,1575,1643,1925,375,592,620,836,654,860,907,1119,731,926,962,1189,968,1206,1244,1488,747,964,980,1235,1041,1259,1318,1564,1095,1335,1364,1595,1414,1676,1721,1977,778,1056,1080,1294,1134,1344,1373,1626,1169,1407,1453,1704,1505,1752,1819,2087,1268,1460,1524,1768,1584,1841,1872,2182,1631,1900,1951,2224,2025,2299,2394,2688,137,263,287,466,324,496,524,715,336,534,562,739,590,770 ,819,1087,368,577,625,793,646,858,844,1101,663,877,913,1160,958,1183,1215,1474,439,637,665,857,730,901,932 ,1192,738,959,974,1218,998,1247,1277,1547,749,990,1029,1274,1092,1315,1356,1600,1127,1397,1411,1679,1456,1727,1782,2051,450,728,734,948,751,967,1004,1256,781,1044,1077,1303,1113,1347,1404,1662,920,1090,1137,1361,1171,1431,1463,1712,1253,1468,1527,1771,1587,1836,1866,2173,971,1177,1232,1434,1271,1511,1555,1793,1326,1570,1609,1860,1657,1906,1971,2251,1370,1634,1690,1945,1743,1991,2047,2319,1804,2073,2117,2373,2157,2470,2494,2875,458,755,767,1081,899,1105,1130,1393,936,1157,1186,1442,1241,1485,1542,1788,978,1212,1265,1496,1297,1559,1612,1853,1350,1648,1604,1889,1718,1963,2019,2279,1098,1282,1312,1579,1387,1621,1684,1931,1425,1693,1737,1997,1777,2033,2095,2362,1508,1757,1815,2059,1877,2133,2165,2443,1914,2215,2243,2524,2308,2567,2601,2797,1174,1323,1422,1698,1482,1732,1762,2039,1535,1825,1847,2111,1894,2141,2232,2482,1550,1883,1937,2207,2011,2260,2269,2583,2081,2330,2350,2617,2420,2710,2750,3042,1665,1985,2005,2288,2103,2339,2385,2652,2149,2432,2455,2730,2539,2773,2904,3134,2190,2509,2552,2822,2633,2846,2933,3187,2671,2967,3002,3252,3083,3328,3433,3584,10,40,66,145,86,157,190,299,102,179,209,327,236,359,370,576,118,201,219,352,261,388,438,594,284,433,412,623,489,655,678,889,133,245,277,400,291,428,460,631,333,479,499,659,555,705,725,938,364,508,568,718,589,750,783,972,619,790,824,1040,841,1070,1123,1392,169,253,312,474,340,494,550,687,377,573,513,729,606,761,804,994,422,563,614,786,639,814,839,1058,671,849,895,1099,934,1142,1182,1477,470,627,664 ,835,709,868,918,1132,742,922,970,1164,1000,1219,1260,1549,796,988,1049,1234,1065,1263,1317,1607,1115,1334,1378,1653,1420,1695,1766,2107,227,306,346,560,394,586,597,800,444,611,643,831,675,866,879,1129,4

85,648,6
83,872,721,915,960,1170,757,963,991,1205,1055,125
1,1305,1585,522,698,746,931,765,966,1010,1237,828
,1043,1
067,1269,1112,1331,1363,1650,876,1091,1136,1346,
1167,1409,1426,1688,1222,1452,1514,1748,1560,180
1,1910,2
109,541,754,810,1018,862,1060,1109,1340,892,1118,
1147,1389,1184,1423,1476,1730,954,1173,1208,1447
,1266,1
503,1554,1817,1293,1565,1616,1862,1667,1929,1969
,2271,1006,1240,1278,1522,1349,1582,1624,1896,14
18,1641,
1691,1953,1750,1979,2067,2355,1472,1711,1770,202
7,1795,2093,2131,2424,1904,2151,2192,2410,2236,2
480,257
0,2856,270,382,406,636,449,652,691,911,454,694,73
3,940,773,996,1022,1299,517,736,775,1030,818,1052
,1085,13
02,845,1083,1126,1375,1176,1415,1436,1686,531,80
8,851,1037,902,1094,1139,1412,927,1159,1187,1440,
1216,14
98,1534,1790,924,1210,1245,1495,1290,1557,1590,1
864,1355,1629,1669,1927,1709,1967,2035,2332,581,
885,905,
1153,950,1199,1243,1480,975,1257,1275,1552,1320,
1605,1638,1921,1120,1308,1352,1614,1395,1660,170
5,1959,1
458,1720,1779,2021,1827,2091,2137,2399,1196,1383
,1444,1683,1492,1744,1784,2069,1544,1808,1843,21
05,1912,
2169,2209,2460,1619,1908,1933,2194,1961,2238,218
0,2502,2048,2323,2357,2588,2371,2682,2733,2914,6
02,944,9
56,1287,1097,1328,1360,1627,1156,1372,1398,1674,
1455,1725,1775,2075,1190,1450,1490,1728,1521,178
6,1832,2
115,1569,1849,1893,2159,1955,2203,2266,2514,1296
,1501,1532,1828,1589,1879,1939,2184,1672,1941,19
73,2262,
2049,2230,2344,2593,1741,2009,2085,2326,2119,236
9,2403,2654,2171,2417,2415,2718,2504,2756,2794,3
031,138
1,1562,1633,1943,1723,1975,2031,2286,1781,2071,2
097,2360,2147,2378,2413,2676,1834,2127,2186,2401
,2211,24
22,2507,2759,2284,2527,2560,2806,2622,2868,2907,
3150,1923,2196,2256,2512,2341,2517,2609,2825,235
3,2598,2
660,2891,2704,2940,3006,3234,2380,2685,2744,2960
,2779,3016,2985,3266,2849,3064,3098,3347,3166,33
89,3444,
3576,320,416,464,667,503,740,779,1013,527,794,821
,1028,859,1076,1088,1401,536,855,882,1073,909,120
2,1225,
1469,979,1231,1284,1545,1325,1594,1636,1949,545,
898,947,1213,984,1281,1311,1577,1015,1337,1366,1
645,1406 ,1697,1736,1981,1047,1386,1433,1716,148
4,1773,1802,2057,1506,1791,1851,2123,1858,2155,2
200,2575,702,982,
1003,1321,1034,1369,1403,1681,1104,1437,1461,175
9,1513,1814,1845,2079,1150,1466,1529,1797,1574,1
856,187
0,2139,1610,1873,1891,2205,2007,2241,2312,2596,1
193,1572,1599,1887,1658,1935,1947,2221,1702,2003
,2041,22
82,2101,2335,2364,2663,1755,2063,2121,2366,2176,
2396,2465,2707,2253,2475,2529,2762,2562,2816,287
8,3142,7
14,1025,1078,1429,1144,1464,1518,1823,1179,1537,
1580,1875,1622,1902,1916,2213,1254,1602,1655,191
8,1700,1
995,2029,2273,1753,2053,2099,2348,2143,2382,2439
,2665,1314,1677,1734,2037,1806,2089,2083,2387,18
38,2129,
2153,2427,2226,2467,2492,2768,1898,2178,2247,248
4,2275,2544,2565,2828,2321,2591,2636,2894,2716,2
947,300
9,3239,1358,1764,1812,2135,1868,2167,2228,2477,1
989,2249,2295,2554,2304,2572,2614,2865,2013,2297
,2317,26
06,2389,2630,2696,2937,2451,2713,2741,2964,2791,
3034,3075,3280,2055,2408,2434,2668,2497,2721,275
3,2992,2
532,2785,2831,3060,2881,3102,3158,3363,2641,2837
,2897,3114,2954,3174,3200,3427,2995,3221,3261,34
61,3313,
3510,3569,3740,769,1106,1161,1540,1248,1597,1646
,1965,1272,1663,1714,2001,1761,2045,2113,2441,13
43,1739,
1821,2077,1855,2163,2145,2458,1881,2188,2234,252
2,2290,2547,2580,2853,1487,1840,1885,2161,1987,2
219,225
8,2557,1999,2292,2310,2585,2337,2620,2649,2920,2
015,2328,2376,2646,2448,2693,2736,2971,2487,2776
,2788,30
38,2834,3079,3126,3337,1509,1983,1993,2277,2017,
2301,2346,2628,2061,2392,2429,2679,2472,2724,278
2,3024,2
245,2446,2499,2738,2534,2809,2840,3068,2625,2843
,2900,3118,2957,3170,3195,3421,2306,2542,2604,28
12,2644,
2888,2927,3138,2701,2944,2978,3191,3020,3225,327
5,3479,2747,2999,3049,3257,3094,3289,3332,3523,3
146,335
2,3384,3556,3410,3620,3636,3827,1526,2023,2043,2
436,2217,2463,2489,2771,2264,2519,2549,2819,2612
,2862,29
17,3130,2315,2578,2638,2872,2674,2930,2981,3183,
2727,3013,2974,3212,3072,3270,3308,3497,2453,265
7,2690,2
950,2765,2988,3045,3243,2803,3053,3090,3294,3122
,3318,3368,3549,2884,3106,3154,3342,3204,3394,34
16,3605,
3230,3456,3473,3652,3516,3676,3694,3792,2537,269
9,2800,3057,2859,3087,3110,3323,2910,3162,3178,3

378,321
7,3400,3467,3628,2923,3208,3248,3450,3303,3485,3
491,3685,3358,3529,3542,3702,3591,3750,3770,3896
,3027,32
84,3298,3504,3373,3536,3563,3721,3405,3598,3613,
3760,3660,3781,3840,3929,3438,3644,3668,3803,371
2,3815,3
853,3947,3730,3866,3881,3968,3912,3990,4016,4049
,11,46,79,183,105,199,256,393,128,242,280,427,314,
467,482,
743,148,268,292,459,345,512,572,768,374,566,539,8
01,634,843,870,1117,166,325,365,526,384,559,598,8
11,435,6
22,645,847,717,900,925,1175,475,657,732,917,758,9
53,993,1214,797,1001,1042,1292,1064,1327,1388,16
68,214,3
35,410,616,443,640,711,878,490,737,668,929,782,96
9,1020,1239,553,727,792,997,820,1031,1061,1313,86
1,1071,1
128,1359,1172,1408,1451,1756,610,806,852,1057,90
8,1096,1152,1396,945,1155,1211,1432,1249,1494,15
33,1826,
1012,1233,1304,1504,1322,1536,1591,1884,1377,160
8,1654,1930,1696,1970,2040,2386,303,401,451,722,5
19,753,
772,1016,579,787,825,1053,865,1093,1107,1394,628,
829,874,1100,921,1148,1201,1438,965,1204,1236,14
78,1310,
1523,1578,1863,679,891,949,1168,973,1207,1258,15
07,1046,1298,1324,1543,1374,1606,1640,1926,1103,
1351,139
9,1620,1435,1685,1703,1964,1497,1729,1792,2022,1
837,2076,2187,2388,701,957,1027,1267,1086,1316,1
371,1615 ,1121,1379,1413,1666,1454,1701,1751,200
4,1195,1443,1481,1724,1538,1780,1831,2094,1566,1
844,1892,2138,194
2,2206,2246,2551,1255,1512,1551,1800,1625,1859,1
901,2174,1694,1917,1966,2229,2024,2254,2343,2635
,1749,19
86,2044,2302,2070,2372,2411,2705,2181,2430,2473,
2691,2516,2760,2845,3100,355,497,532,815,585,834,
883,114
5,591,887,933,1178,981,1242,1273,1573,674,937,985
,1283,1035,1307,1345,1576,1068,1339,1391,1652,14
46,1692,
1713,1962,690,1024,1075,1289,1135,1354,1402,1689
,1165,1427,1457,1717,1489,1776,1811,2066,1162,14
83,1517,
1772,1563,1835,1867,2142,1630,1907,1946,2204,198
2,2242,2311,2613,748,1114,1138,1419,1188,1470,15
15,1758,
1220,1530,1548,1829,1593,1882,1915,2199,1382,158
1,1628,1890,1671,1938,1980,2235,1735,1994,2054,2
296,210
2,2368,2416,2678,1467,1659,1722,1958,1769,2018,2
060,2347,1820,2084,2118,2383,2189,2450,2490,2739
,1897,21
85,2210,2474,2237,2520,2461,2780,2324,2605,2639,
2863,2653,2946,2990,3149,777,1181,1198,1561,1357
,1603,16
35,1905,1424,1647,1675,1950,1733,2000,2052,2352,
1462,1726,1767,2002,1798,2062,2108,2395,1846,212
4,2170,2
438,2233,2483,2548,2792,1571,1778,1809,2104,1865
,2156,2216,2464,1948,2218,2248,2543,2327,2511,26
24,2869,
2016,2285,2363,2607,2397,2650,2684,2921,2452,269
8,2695,2979,2783,3011,3047,3251,1656,1839,1909,2
222,199
6,2252,2307,2568,2056,2349,2374,2642,2428,2659,2
694,2941,2110,2405,2466,2681,2491,2702,2786,3014
,2564,28
04,2836,3056,2892,3112,3143,3350,2201,2478,2536,
2789,2621,2795,2880,3071,2632,2871,2926,3131,296
8,3172,3
228,3422,2661,2949,3003,3192,3032,3237,3211,3445
,3093,3278,3306,3511,3364,3546,3588,3696,419,546,
604,856 ,651,941,989,1261,685,1005,1038,1280,1082
,1333,1348,1678,695,1079,1110,1330,1141,1473,149
9,1747,1223,150
2,1558,1822,1601,1871,1913,2227,706,1131,1185,14
86,1230,1553,1586,1854,1264,1613,1642,1922,1682,
1972,201
0,2257,1301,1664,1708,1992,1760,2046,2080,2336,1
783,2068,2128,2402,2136,2437,2481,2851,896,1227,
1252,159
6,1286,1644,1680,1956,1365,1715,1738,2032,1789,2
090,2122,2358,1416,1745,1807,2074,1850,2132,2148
,2419,18
88,2150,2168,2486,2283,2523,2594,2870,1465,1848,
1876,2164,1934,2212,2223,2503,1978,2280,2316,256
3,2381,2
616,2645,2929,2030,2342,2400,2647,2456,2675,2745
,2970,2535,2754,2807,3018,2839,3066,3117,3343,91
2,1276,1
336,1706,1410,1740,1796,2098,1449,1816,1857,2154
,1899,2179,2193,2495,1528,1880,1932,2195,1974,22
70,2305,
2553,2026,2331,2377,2631,2423,2664,2719,2932,158
8,1954,2008,2313,2082,2367,2361,2667,2112,2409,2
433,270
8,2506,2748,2772,3023,2175,2459,2528,2763,2556,2
821,2842,3074,2602,2866,2903,3133,2976,3179,3231
,3425,16
32,2038,2088,2414,2144,2447,2508,2757,2265,2531,
2576,2830,2584,2848,2886,3108,2289,2579,2599,287
7,2670,2
901,2958,3169,2731,2973,3000,3194,3044,3255,3288
,3457,2333,2687,2714,2935,2774,2982,3008,3218,28
10,3039,
3078,3276,3121,3310,3356,3524,2909,3084,3137,332
1,3185,3371,3391,3579,3222,3409,3441,3602,3486,3
642,369
0,3819,977,1368,1430,1818,1520,1874,1924,2240,15
46,1940,1988,2276,2036,2322,2391,2722,1618,2014,
2096,235 4,2130,2444,2425,2737,2158,2469,2515,2801,2571,2824,2857,3096,1765,2116,2162,2442,2263,2500,2540,2833,2274,2573,2590,2860,2619,2889,2918,3156,2291,2610,2656,2915,2728,2955,2993,3198,2766,3029,3041,3258,3081,3292,3331,3502,1787,2259,2268,2559,2294,2582,2627,2898,2338,2673,2711,2943,2751,2984,3036,3245,2525,2725,2777,2997,2813,3059,3086,3282,2895,3091,3140,3324,3188,3367,3387,3574,2587,2818,2874,3062,2912,3127,3163,3339,2965,3175,3205,3383,3241,3413,3453,3617,3005,3224,3265,3437,3304,3465,3499,3653,3346,3515,3541,3680,3565,3726,3737,3887,1803,2300,2318,2715,2498,2742,2769,3026,2545,2798,2827,3069,2883,3105,3152,3335,2595,2854,2906,3115,2938,3165,3207,3379,2987,3235,3201,3402,3286,3448,3482,3632,2734,2924,2952,3181,3021,3214,3262,3429,3054,3268,3300,3469,3327,3490,3528,3674,3124,3314,3354,3507,3395,3551,3570,3714,3418,3597,3612,3751,3647,3769,3784,3860,2815,2962,3051,3272,3103,3296,3317,3494,3147,3360,3375,3538,3406,3555,3607,3732,3159,3398,3432,3593,3477,3622,3626,3776,3520,3658,3669,3790,3703,3828,3843,3939,3247,3462,3474,3637,3533,3663,3686,3805,3560,3708,3719,3835,3757,3851,3897,3964,3583,3744,3763,3869,3797,3877,3906,3978,3812,3917,3927,3994,3951,4010,4031,4056,229,504,662,1008,763,1050,1158,1459,838,1124,1217,1525,1295,1598 ,1623,2012,904,1191,1246,1583,1362,1661,1763,2042,1421,1754,1710,2092,1861,2146,2183,2485,961,1319,1405,1687,1441,1742,1805,2106,1541,1842,1878,2152,1976,2225,2255,2546,1611,1895,1998,2244,2034,2293,2340,2589,2086,2351,2398,2669,2421,2703,2761,3025,1089,1342,1491,1833,1556,1869,1968,2197,1637,2006,1903,2261,2064,2309,2370,2615,1731,1990,2078,2345,2120,2384,2418,2689,2172,2431,2493,2735,2541,2781,2823,3099,1824,2100,2160,2412,2231,2457,2521,2770,2281,2526,2586,2805,2623,2861,2902,3157,2359,2608,2680,2876,2697,2905,2956,3203,2752,2972,3012,3238,3050,3269,3320,3535,1270,1475,1568,1984,1673,2028,2050,2365,1774,2072,2126,2407,2177,2454,2471,2767,1852,2134,2191,2462,2250,2518,2574,2811,2303,2577,2611,2847,2686,2893,2945,3186,1920,2214,2287,2538,2314,2581,2634,2879,2404,2672,2700,2911,2749,2969,2998,3236,2468,2726,2775,2983,2808,3040,3055,3264,2864,3077,3129,3307,3167,3344,3415,3537,1952,2298,2379,2643,2449,2692,2746,2977,2488,2755,2787,3022,2826,3052,3097,3295,2566,2814,2850,3073,2908,3120,3161,3355,2934,3171,3210,3385,3249,3428,3452,3627,2629,2882,2919,3136,2986,3184,3216,3407,3048,3229,3267,3442,3309,3458,3512,3671,3095,3281,3322,3487,3340,3527,3550,3705,3412,3561,3585,3698,3609,3731,3771,3880,1385,1649,1699,2114,1785,2140,2202,2513,1794,2208,2267,2550,2325,2618,2648,2939,1911,2272,2329,2658,2390,2683,2720,2942,2426,2717,2764,3010,2817,3046,3063,3263,1936,2375,2435,2666,2501,2729,2778,3043,2533,2799,2829,3067,2858,3116,3145,3336,2530,2852,2887,3113,2931,3164,3190,3386,2991,3220,3250,3426,3279,3451,3492,3659,2020,2479,2505,2793,2561,2841,2885,3101,2592,2899,2916,3160,2959,3202,3227,3423,2758,2948,2989,3209,3028,3244,3277,3446,3082,3287,3329,3483,3361,3526,3553,3692,2838,3017,3070,3260,3111,3305,3333,3513,3153,3349,3372,3534,3417,3572,3594,3722,3213,3414,3430,3586,3447,3610,3578,3741,3500,3655,3672,3778,3679,3817,3836,3900,2058,2555,2569,2928,2732,2966,2996,3219,2796,3007,3030,3254,3080,3291,3326,3517,2832,3076,3109,3293,3135,3334,3365,3540,3173,3376,3404,3566,3443,3590,3625,3746,2936,3119,3144,3362,3189,3396,3434,3580,3253,3435,3454,3623,3501,3606,3665,3780,3302,3476,3522,3656,3543,3678,3695,3806,3573,3701,3700,3831,3742,3845,3859,3936,3015,3168,3223,3436,3290,3455,3489,3635,3330,3514,3530,3673,3559,3682,3699,3814,3366,3547,3581,3693,3595,3704,3743,3846,3634,3752,3766,3863,3793,3885,3898,3969,3424,3587,3619,3745,3664,3747,3787,3870,3670,3783,3808,3892,3825,3908,3928,3989,3683,3818,3841,3915,3854,3932,3922,3997,3878,3945,3955,4014,3973,4023,4033,4055,1510,1719,1813,2166,1886,2278,2334,2637,1928,2356,2393,2655,2445,2709,2723,3033,1944,2440,2476,2706,2510,2844,2867,3092,2597,2873,2925,3155,2963,3193,3226,3440,1960,2496,2558,2855,2603,2922,2951,3180,2640,2975,3001,3232,3037,3271,3299,3459,2677,3019,3061,3285,3104,3325,3345,3506,3123,3338,3377,3545,3382,3564,35 89,3773,2220,2600,2626,2961,2662,3004,3035,3259,2740,3065,3085,3315,3128,3353,3374,3519,2790,3089,3141,3341,3177,3381,3390,3554,3206,3392,3403,3592,3475,3611,3649,3782,2835,3176,3197,3401,3242,3431,3439,3601,3274,3472,3495,3633,3532,3661,3675,3809,3312,3509,3544,3677,3575,3691,3724,3826,3618,3728,3753,3847,3767,3867,3888,3966,2239,2651,2712,3058,2784,3088,3132,3359,2820,3148,3182,3393,3215,3411,3419,3596,2896,3199,3240,3420,3273,3468,3488,3629,3311,3503,3531,3667,3557,3684,3711,3810,2953,3256,3297,3493,3348,3525,3521,3687,3369,3548,3562,3706,3603,3725,3736,3849,3408,3577,3615,3733,3630,3759,3768,3871,3654,3779,3798,3893,3830,3910,3930,3991,2994,3319,3351,3552,3388,3571,3604,3729,3464,3616,3640,3764,3645,3772,3789,3884,3478,3641,3651,3786,3688,3796,3822,3907,3717,3829,3839,3916,3858,3937,3949,4000,3505,3697,3709,3811,3738,3832,3844,3924,3754,3856,3872,3944,3889,3956,3971,4018,3800,3874,3894,3959,3913,3975,3981,4030,3925,3986,3996,4036,4007,4044,4054,4075,2320,2743,2802,3151,2890,3196,3233,3449,2913,3246,3283,3471,3316,3498,3539,3713,2980,3301,3357,3518,3380,3568,3558,3720,3397,3582,3608,3749,3638,3761,3775,3879,3107,3370,3399,3567,3463,3600,3621,3765,3470,3639,3648,3777,3662,3791,3804,3902,3480,3657,3681,3802,3716,3821,3837,3918,3734,3852,3857,3938,3873,3950,3962,4012,3125,3460,3466,3631,3481,3643,3666,3795,3508,3689,3707,3816,3727,3833,3855,3934,3614,3715,3739,3838,3755,3864,3875,3946,3794,3876,3895,3960,3914,3974,3980,4029,3646,3758,3785,3865,3801,3891,3904,3965,3824,3909,3920,3979,3933,3987,3999,4039,3842,3926,3941,3995,3954,4002,4011,4046,3967,4015,4022,4052,4027,4061,4063,4083,3139,3484,3496,3710,3599,3723,3735,3850,3624,3748,3762,3868,3788,3883,3901,3963,3650,3774,3799,3886,3813,3905,3921,3977,3834,3931,3919,3984,3948,3998,4006,4042,3718,3807,3820,3911,3848,3923,3940,3992,3862,3942,3953,4003,3961,4008,4019,4051,3890,3957,3970,4013,3982,4024,4028,4059,3988,4035,4038,4065,4045,4068,4070,4080,3756,3823,3861,3943,3882,3952,3958,4009,3899,3972,3976,4021,3985,4025,4037,4062,3903,3983,3993,4034,4005,4040,4041,4069,4017,4047,4050,4071,4057,4076,4078,4088,3935,4001,4004,4043,4020,4048,4053,4073,4026,4058,4060,4077,4066,4079,4084,4090,4032,4064,4067,4081,4072,4082,4085,4091,4074,4086,4087,4092,4089,4093,4094,4095]

**Sequence group 3: Q3_8192**

[0,1,2,4,8,16,32,3,5,64,1024,2048,4096,9,6,17,10,18,128,12,33,65,20,256,34,24,36,7,129,66,512,11,40,68,130,19,13,48,14,72,257,1025,21,132,35,258,26,2049,513,80,37,25,22,4097,136,260,264,38,514,96,67,41,144,28,69,42,516,49,1026,74,272,160,520,288,528,192,544,70,44,131,81,2050,50,73,15,320,133,52,1028,23,134,384,76,4098,137,82,56,27,97,39,259,84,138,145,261,1032,29,43,2052,98,515,88,140,30,146,71,262,265,161,576,45,1040,100,640,51,148,46,75,4100,266,273,517,2056,104,162,53,193,1056,152,77,164,768,268,274,518,54,83,57,521,1027,112 ,135,2064,78,289,194,85,276,4104,522,58,168,1029,139,99,86,60,280,89,290,529,2080,524,196,1088,141,101,147,176,142,530,321,31,200,1033,4112,90,545,292,2051,322,532,263,149,102,105,1030,304,296,163,92,47,267,385,546,2053,324,1041,208,386,4128,150,153,165,106,55,1034,328,536,577,548,2112,113,154,79,269,1042,108,578,224,166,519,552,195,4099,1152,270,3072,641,523,275,580,291,59,1036,169,560,114,277,156,2057,87,197,1057,116,170,4101,61,531,525,642,281,1089,278,526,2054,177,293,388,91,1044,584,769,198,172,120,4160,201,2065,336,1280 ,62,282,143,103,178,294,1058,93,644,2058,202,592,323,1048,392,5120,297,770,107,180,151,1060,2066,209,284,648,94,204,298,1031,400,608,352,2176,6144,325,533,1153,155,210,305,547,300,1090,109,2060,184,534,537,115,167,1536,4105,225,326,306,772,2081,157,1035,656,329,110,117,212,1064,171,2113,776,4102,330,226,549,1092,538,387,308,216,2068,1154,416,271,279,158,337,1043,4113,550,672,2304,118,332,579,1037,540,389,173,121,1072,2082,553,199,784,4106,179,1038,228,338,312,2072,704,390,1096,174,554,581,393,1281,4114,283,2084,122,448,353,1045,561,203,63,340,2055,1156,394,527,582,4224,556,181,1059,2177,295,285,232,124,1282,205,182,643,2114,4108,562,1050,286,585,299,1537,354,211,2560,401,185,1104,396,344,4129,586,645,2059,1061,593,535,240,206,104
9,95,2088,327,564,4161,1046,800,402,356,307,2116,
1160,301,417,213,568,1284,832,4116,2178,588,186,1
288,646,
404,227,896,2067,1062,594,418,4352,302,1538,649,7
71,2061,360,539,1120,111,331,214,1091,2096,4130,3
09,188,
449,1065,217,408,2062,609,596,1168,551,650,4120,2
29,1052,2120,159,420,310,1093,541,773,2305,610,41
32,1066 ,657,333,119,1540,3073,600,339,218,1073,3
68,652,4103,230,2069,1098,391,313,450,1296,542,21
80,334,233,4225,
1184,555,774,175,2083,1544,123,658,612,1312,2306,
4162,341,777,220,1552,314,424,2074,395,1216,673,5
83,4608 ,355,1568,2561,287,183,234,1094,125,557,2
128,4107,660,1068,616,342,316,2085,1155,241,778,1
105,563,4136,34
5,2073,452,1074,397,403,207,2070,1097,674,4164,55
8,1039,785,432,2184,357,1344,187,236,664,4226,230
8,1157,
624,587,1076,780,2312,705,126,1047,4115,242,565,1
158,2086,398,346,456,1408,358,2562,4109,405,1100,
303,569 ,244,2144,1161,595,189,4144,1106,566,2115
,676,361,1080,706,589,2089,1051,4110,215,786,647,
1121,2192,348,4
19,1063,406,4168,464,2076,680,1283,801,362,1108,2
117,590,4353,409,1162,570,2090,788,597,1169,572,2
19,5121 ,2564,1285,311,708,1053,598,2097,601,1067
,4117,651,421,3074,792,1122,802,611,1539,2122,422
8,602,410,1112,
231,688,2320,1164,653,248,4131,1054,2208,369,190,
364,1170,654,2568,4354,659,1095,335,480,2336,128
6,315,22
1,1289,4122,2576,370,613,1185,422,425,2240,1600,6
145,451,614,1069,2592,543,235,1124,412,4609,2118,
343,372 ,1664,775,317,2092,1075,222,4176,426,1172
,2179,453,237,1070,559,2129,4133,833,1099,804,712
,2098,1290,834,
661,4121,1297,2121,808,779,1541,617,1128,2063,41
18,604,433,1186,720,2368,816,1077,4232,836,347,21
81,1217,
897,243,1176,2100,4356,662,454,1101,318,3076,675,
1188,618,4360,898,2071,1792,781,376,2182,1292,41
34,428,1
298,665,2432,736,1542,567,840,4610,2124,1078,625,
238,1107,2185,359,4192,457,1081,399,2130,787,154
5,591,11
36,4163,2104,678,434,1159,2075,677,349,4137,1102,
245,2145,458,1313,666,1218,4240,2087,620,363,110
9,2307,1
27,191,4124,1300,782,2132,1546,407,436,1082,4165,
2186,626,571,1192,2193,465,1163,681,4138,246,230
9,1123,7
07,350,3080,4612,1110,599,1084,668,2077,790,1304,
4145,460,2091,249,1113,682,1314,2146,5122,573,41
1,1553,2
563,803,789,1548,4170,709,2136,1220,365,440,2188,
1165,4368,628,1125,689,2078,374,1171,4256,423,21
94,466,1
200,793,2119,1166,4616,250,371,1554,2310,481,134
5,574,4384,2313,413,1055,603,2209,1224,4624,366,4
68,1114,
2624,655,1569,900,4288,2093,805,1316,615,3088,13
46,4640,684,710,2148,1556,429,1287,4166,2688,794,
252,117
3,373,2099,1126,4140,605,848,2196,1129,690,1328,4
227,2094,713,1320,632,2123,482,4177,1187,806,231
4,1116,4
27,904,6146,2321,1071,414,1291,2565,223,663,4146,
1409,2152,692,1570,835,2210,4169,1348,619,472,21
01,1232,
455,4111,1410,2241,796,809,1174,3104,4416,714,11
77,721,2200,1189,837,4229,716,2125,1130,864,1079,
2212,41
48,810,1352,606,2816,912,5124,1560,722,2316,1601,
696,1572,4119,2322,377,435,1137,2566,817,4230,11
78,319,2
102,1103,621,1293,4480,2131,812,484,1132,2105,43
0,4172,1602,838,2569,1248,667,4233,3075,488,1190,
239,216
0,1543,4178,378,1576,2183,459,1219,622,4152,2126,
627,1294,437,2337,4123,1665,380,2242,1547,818,12
99,4193,
2133,461,496,1604,2324,4135,669,1315,2570,679,10
83,724,4355,2106,1193,841,629,2216,4180,1584,351,
1138,30
77,467,1301,4234,2187,438,1180,737,2147,4241,111
1,251,1221,2134,462,4357,442,2108,1140,441,1194,2
328,512
8,469,1085,2137,247,1555,4125,683,2338,1549,842,1
666,4139,2577,738,899,2572,1305,6148,670,1302,22
44,783,1
550,3136,4194,849,1201,820,2189,1317,4611,728,21
49,1412,928,1115,4184,2195,791,367,2224,1608,423
6,901,17
93,2190,630,1222,4126,2578,685,1196,844,2369,424
2,1144,633,2079,1225,711,4167,1360,2248,253,1086,
3081,43
58,691,1306,824,2138,1167,4361,902,2593,1127,686,
740,4257,2340,1202,850,2370,1318,4672,375,2580,1
117,444,
1668,4141,2311,470,1226,2197,483,5136,1616,415,2
150,1347,485,4196,2153,1416,905,3078,1321,4736,7
95,1794,
2352,473,4147,1131,2344,634,1204,2211,4244,744,1
175,852,2140,1233,4142,960,2095,1308,865,2315,41
71,1672,
693,2433,1118,4362,797,1228,2594,906,1322,4369,2
372,715,1424,3089,807,4613,1632,474,2256,1376,61
52,636,2
434,1349,694,2198,4200,1557,254,2201,1179,717,42
58,2213,1234,575,1329,4149,2154,913,1571,2103,79
8,4289,1
324,3082,811,1133,5152,2376,379,1208,2584,697,42
48,1558,431,2625,607,4173,489,2596,1561,866,2161,
4260,11 39,723,2202,1191,4864,486,2127,1249,908,2317,4364,1350,718,1330,3090,4370,813,1796,2156,476,4614,1181,26
26,856,1680,2272,4150,839,1353,2214,725,4179,1134,2567,698,1141,2600,4153,914,1236,2243,752,4617,1195,32
00,868,1800,5123,2318,819,1354,2689,4208,814,1250,439,2571,1573,4231,929,2323,1562,490,6160,2628,1411,62
3,2339,4174,1332,671,2107,1240,4385,739,3084,1440,916,2217,4290,1295,463,2608,1303,4181,843,2162,1182,38
1,4372,2325,1361,497,2204,4618,1574,930,2135,1696,4154,821,2245,1142,726,4264,3105,1356,1603,2164,5125,9
61,2218,1564,872,2109,4235,1413,492,2579,1197,4195,631,2573,1145,729,4182,2690,1577,700,2329,4156,1223,4
43,3137,1808,4376,741,2326,1203,845,4185,2574,1252,920,2225,4386,1362,382,2341,1336,4625,822,2436,1728,2
139,6176,1414,851,3092,1198,4620,730,2632,1578,498,4292,2817,1605,880,5184,2246,1417,742,2220,4237,1307,
445,2168,1146,4197,2249,471,1472,2384,4243,1377,635,3328,1585,4272,932,2110,1227,687,4238,2330,1087,903,
2191,4626,1364,2151,825,4417,1418,2226,500,1551,4127,2342,1606,846,3106,4296,1580,745,2141,1205,5129,269
2,826,1319,2250,4186,732,1309,2640,4641,446,1256,2371,1148,4388,3096,962,1229,2440,6147,936,1206,2345,44
18,475,1667,2818,853,4628,2155,1586,867,2228,4359,1310,1609,2199,637,4245,1323,3108,907,4198,2257,1378,4
87,2332,4201,1235,695,2696,5126,1425,2142,1209,746,4400,2252,1420,828,2346,4392,1368,3079,753,4259,1610,
2448,854,1669,4188,2656,1617,2400,857,4143,1559,2373,504,4363,1264,2581,799,3201,4481,1230,1119,2203,464
2,255,1351,2258,964,6149,2353,1588,909,4420,2595,1824,719,2348,5137,1426,3138,1380,4304,477,2157,1331,91
5,4482,2232,1325,2582,4246,638,1441,2585,1237,4249,2163,748,1592,4261,2215,944,1856,3584,4202,869,2273,1
612,4151,1210,2374,491,5130,2354,1670,699,2820,4424,1428,1251,2205,4632,754,3083,1920,858,4673,2704,1618 ,2377,4644,478,1442,2158,6208,1326,968,2165,1673,4209,2260,383,1795,4250,3112,910,2219,4175,1384,1563,28
24,815,4365,2378,1135,976,5138,2274,1355,2597,4204,1238,870,3140,1333,4674,2586,917,1212,4320,2435,1473,
2356,4262,727,1241,2264,493,4615,3202,1432,873,4648,2464,1633,2319,4291,1620,701,2327,5248,1575,
2206,931 ,4366,1674,2385,1253,3091,7168,756,1183,2598,4737,860,2720,1444,4619,1334,2166,499,4371,2380,1565,731,26
27,4676,1797,3085,1634,4387,823,2588,1681,4155,2437,922,1357,5132,2221,1143,2169,4265,874,1624,3120,4656 ,918,2601,1363,4210,2247,1242,502,2832,4373,1392,2227,933,4252,1676,3086,1254,6153,2276,743,1415,4183,23
86,1337,2360,4293,760,2752,1474,5153,881,2438,1566,4212,3144,1358,494,4266,2222,1257,2602,4157,702,2629,
1579,4627,1798,2441,921,4621,3329,1199,501,4738,2331,1147,2170,4377,1682,2496,876,5185,1636,2401,1365,43
74,3093,847,1801,2609,4622,992,2251,6150,1244,2111,1338,4273,447,2388,1448,4389,3204,1419,2442,4484,733,
1697,2575,4187,827,2630,1607,5140,2604,1379,934,4680,2229,1311,3107,4865,1207,2343,882,4294,1258,2333,93
7,4268,2280,1149,2172,4216,1581,963,3330,4297,1684,2253,1640,6161,2230,747,1366,4432,2691,505,2610,5376,
1340,3098,1265,4158,855,2334,4378,1802,2633,1587,4239,2347,924,3585,4199,1369,734,2402,4274,1476,2259,14
21,4390,2449,829,1427,5154,2233,1231,3152,4189,965,2444,4740,1698,2392,1582,6154,938,2634,1809,4298,2693 ,1456,3109,4688,884,1381,2641,4419,506,2583,5144,1211,2288,1260,4488,2254,749,1688,4393,3097,1648,2143,4
866,945,2375,1611,4203,2612,1804,4276,966,3094,1729,4247,2848,1150,2450,5156,755,2404,1266,6162,859,2355 ,4305,1589,3208,1422,4380,2349,940,2465,4744,1370,2261,4190,1480,830,2616,4300,1382,3332,1429,4394,2880,
911,2636,5127,1327,1593,4496,2234,871,3336,4704,1268,2694,1619,4448,2452,639,6272,2275,1213,1590,4421,29
44,888,3110,4629,1700,2642,5249,1385,2466,479,4251,2350,1730,3586,4306,1613,946,4401,2697,1239,2819,4643 ,750,2408,4396,1810,2587,1671,5186,3168,969,2159,4205,1372,1443,6156,2379,508,2262,4280,1430,3139,4630,1
488,2357,861,4633,2236,1704,2497,4211,1825,757,4263,3113,1386,2265,5632,1614,2456,4321,970,2657,1433,442
2,2644,1594,3216,4402,919,2599,4868,1812,1621,2698,6177,1596,2277,4253,875,3100,1243,5131,2207,1335,4752 ,2468,862,2358,4425,1732,3141,4206,1622,2589,758,4213,1625,2821,4308,1675,2658,948,5160,3114,1445,4267,2
705,1816,2381,6209,977,2167,4872,1826,3588,1635,4426,2648,923,4322,2387,1626,2266,4645,1434,972,5188,312
1,1255,2416,4634,1712,2700,4483,761,2278,1677,4404,3146,1272,4312,2439,877,6164,2361,1393,2498,5250,1214 ,3344,4512,1388,2590,952,4367,2382,1678,4375,2281,1683,495,4254,3232,1359,4433,2603,1504
,5139,2822,703,2
223,4646,1339,3592,4768,1245,2171,935,6400,2706,
1394,4214,2660,1637,4428,3360,978,2389,4675,1446
,2825,51
33,1449,2268,1475,4636,3600,883,4485,2362,1638,4
269,2472,1567,2443,4217,762,3264,5168,1259,2721,
6178,143
6,2631,503,4649,2403,1367,4295,3616,1396,4880,23
35,925,2231,4275,1799,2282,5134,1341,3142,4324,1
246,2173 ,878,4434,2605,1450,4408,2708,1477,6168,
3116,735,2664,4800,1261,2390,4486,1583,2364,5192
,1857,3203,4270,
993,2289,1828,4650,2826,1736,4677,3153,885,4489,
2611,1858,2393,5377,1685,2500,4379,939,3122,6180
,1832,24
45,4218,1803,2451,1641,4544,2255,994,4449,3145,1
628,5141,2722,1457,4657,2606,980,3087,4299,1744,
2833,415
9,1840,2480,4436,1860,2405,6151,926,3392,5252,13
71,2235,1921,4490,2284,764,4623,2712,1267,4678,3
205,1686 ,4652,2672,1478,2635,4277,941,3124,5155,
1342,2828,6273,1699,2753,4391,967,2174,4381,1642
,3095,4328,1922,
2290,1805,4220,2613,886,5378,1400,1452,4301,3206
,831,4278,2446,1689,4739,2394,1760,6210,2504,159
1,3456,4
658,947,2406,5146,1864,2453,4382,1649,3148,4681,
507,2351,4395,1262,2617,5633,1383,2292,4450,1481
,3209,88
9,4307,2643,1423,6656,2237,1811,4497,3154,1615,4
281,2614,984,5200,2724,1702,4492,2409,1458,4440,
3128,751 ,4682,2754,1701,4741,2637,1373,3099,615
5,1269,2263,5157,942,2834,4689,1482,2695,4631,16
90,3169,4336,1644 ,2396,4302,996,2467,5145,1387,3
111,4191,1151,2454,6184,1215,2512,4423,971,2728,
4660,1806,3331,5142,1431,
2849,4896,890,2410,1460,4498,3156,1650,4452,2638
,1595,4403,2457,509,6212,3210,1489,5256,2618,170
5,4397,2
836,1270,4513,2645,949,4309,3217,1731,4664,2620,
1374,5380,2267,1623,4928,3333,973,6274,2359,1692
,4684,27
56,1814,4282,3101,1484,5384,2646,1000,4742,2649,
1273,4500,3115,1706,4323,2699,1597,4992,2469,892
,6163,28
40,1435,5158,3170,1827,4690,2850,1813,4514,2659,
950,4398,3587,1733,5634,2650,1389,4745,2458,1464
,4867,31
60,863,6157,2279,2736,4456,1652,4635,3212,1713,5
216,2701,1398,4207,2296,759,4427,3102,1447,4310,
2417,149
0,5187,2238,1817,6192,2412,1008,4405,3218,1274,4
284,2702,1395,4545,2707,1505,5161,3143,510,4313,
2383,159
8,4504,2528,3334,6158,1437,2363,4705,1627,4692,2
269,979,5264,3337,1390,4647,2418,1492,4746,2661,
1679,432
5,3233,953,5148,2470,1924,6216,2473,1829,4255,36
48,1639,4516,2499,4406,2662,763,5189,3117,1708,4
637,2591 ,1734,4869,2283,1453,6401,3172,974,4706,
2460,1818,5162,2391,1276,4753,2420,4429,1397,371
2,4215,2823,1629 ,5636,2365,954,7169,3123,1872,46
96,2270,1714,4435,2474,4314,1737,3220,5169,879,2
501,4464,1656,2285,4748,
3118,1506,4326,2607,1830,6165,2881,5194,981,3147
,4487,1451,2852,4409,1928,2760,4546,1438,3338,53
92,2882,
982,4638,2709,6276,1247,3345,4430,1687,2856,4329
,1716,2827,5280,1859,3589,4651,927,4870,2665,317
6,4271,1
643,2652,6179,1496,2481,5640,1479,3234,4219,995,
4754,2768,1820,4708,2864,1833,5408,3125,2884,640
2,1738,4
437,2395,1745,4873,3265,765,4316,2945,1861,5648,
2291,4410,3224,1740,4520,2710,1888,6170,2502,956
,4491,31
49,5312,1834,2366,4769,1630,2723,4679,3236,1936,
4451,2666,5664,1746,2946,6657,887,3840,4383,1720
,2829,42
79,1401,4330,2424,3340,5190,1459,2476,4221,1841,
3346,4653,985,6224,2713,1343,4756,2784,3590,5164
,1645,47
12,2615,1836,4438,2888,997,4412,3126,1508,6181,2
673,5251,2286,1454,4337,3155,1862,4874,2407,5201
,1691,25
05,4659,986,3129,4441,2447,6169,1512,2835,4548,1
263,3593,5170,1402,4493,2639,3184,4499,1483,2726
,4303,94
3,6166,2482,1646,5193,3207,1651,4770,2725,2397,4
654,1461,5135,3150,1404,4881,2293,4528,891,2506,
6280,336
1,1842,4453,2714,5440,1485,3266,4283,1520,2668,4
332,1693,4760,2411,3157,6404,998,2175,5253,1703,
4720,223
9,1748,4683,3348,2830,5172,1865,4876,3594,766,64
08,2455,1653,4801,2484,4222,3130,1375,5143,2674,
4338,149
1,2619,4661,1462,3240,5254,2513,6182,511,3211,44
94,1761,4442,2729,1275,4552,2294,3171,5504,1486,
4454,275
5,1466,6658,2398,4501,1465,3158,5196,2647,988,43
99,3132,4665,1493,2716,4340,1271,6240,2838,3352,
5257,170
7,2508,4691,1866,4285,2297,3161,5202,1001,4662,2
730,1762,6211,3362,1923,4772,2621,4457,2459,1694
,5176,36
01,4802,1807,2851,4685,951,6185,2837,3596,5147,1
873,2757,4311,1844,4882,3268,2413,4743,1752,5217
,2488,19
52,6288,3213,4444,1002,2676,4515,3173,5159,1815,
2737,4502,1391,4560,2422,3219,6172,1925,2471,477
6,1654,5
379,2514,1709,4897,3248,4458,2841,893,5204,3214,
6213,1868,2298,4686,2419,4505,1657,3602,5258,173
5,4666,2

529,3393,6186,1277,4884,2622,975,4693,2461,5265,
1715,3103,4668,2651,4315,1848,3272,6660,1926,538
1,2414,2
516,4407,1710,4804,3162,894,5149,2703,4694,3617,
1764,6193,2948,4697,1874,2853,5163,3364,4747,139
9,2663,4
517,1468,7170,3394,2732,4888,1494,5218,2758,1009
,4898,3604,4707,2477,1507,5635,3335,6218,1439,28
42,4698,
2300,4506,1509,3221,5208,1929,4327,2421,3174,478
4,1819,6416,2653,955,5260,2896,4749,3177,4344,14
97,2738,
5150,1658,6304,3376,2761,4465,1768,4286,3368,187
6,4460,2680,5266,2530,1984,4750,3235,6664,1004,4
755,285
4,3164,5191,1889,4431,2475,1717,4576,2952,6432,3
119,1821,5382,2462,4411,1930,3339,4317,2271,5385
,1010,66
72,2711,1739,4466,3457,4709,2740,1831,5281,3618,
4518,2883,4521,1498,3396,6336,1660,5696,2667,252
0,4547,1
718,4710,3280,957,5165,2503,6688,3458,4639,1278,
2844,4331,1741,5220,2857,3222,4508,1599,6214,276
2,4439,3
225,1937,4468,2769,5760,1822,3237,4871,2885,4413
,983,6188,2764,1835,5171,3178,4318,2912,4522,140
3,3127,5
268,2858,6275,1721,3400,4549,1455,4333,2654,5166
,2960,1631,4655,3608,6225,1513,2770,4929,3649,51
95,958,4
900,2744,3620,4808,1890,6194,2425,5386,1747,2483
,4930,3185,4757,1510,5393,2865,3226,6217,1932,49
04,2367,
4875,1742,3151,5637,2669,4713,987,3341,5224,2860
,6159,1837,4700,2532,1500,4529,3180,5282,2478,48
16,1880,
3650,6464,2886,4912,1863,5173,3296,1749,4932,271
5,4443,2536,6277,1012,3238,5313,2287,4993,1722,4
339,359
1,1938,5272,2426,6196,3624,4758,1776,2507,4550,3
267,5197,1892,4414,2670,7172,1843,2675,4771,3342
,5284,18
38,4714,2485,3713,4994,999,6167,2428,5888,1463,3
595,4877,2866,4472,1953,6278,3347,2509,5388,1514
,4524,25
44,5394,3652,4761,1647,2717,6528,1695,4832,3363,
5638,2727,1763,4663,3131,4936,2772,6220,1016,324
1,5174,2
889,4721,1940,4334,2677,5203,1487,3632,6281,2399
,4455,1867,4553,3186,5177,2515,1405,4495,3349,62
26,2486,
4883,1521,3228,5641,2785,4687,767,5232,3159,6200
,1954,2299,4774,3269,4530,1845,5255,2510,6171,24
90,1750,
4773,3188,4445,2489,5198,1985,4341,3242,1896,624
1,2517,4554,3133,5409,1516,4762,2295,3603,5314,1
655,618
3,2731,4716,3597,4459,989,2890,5205,3714,6403,17
53,4223,2786,4287,2947,1724,5396,3353,4878,1467,
6228,271
8,5642,3350,1765,4503,2831,4532,3598,5178,1869,6
282,2897,4722,3249,1944,4667,2868,5288,3365,6289
,1003,45
61,2776,3460,5259,1406,4777,2976,4342,3163,6405,
1846,5219,2839,1875,4803,2415,4446,3656,7176,175
4,5206,2
949,3841,4695,1522,5180,2678,4764,3270,6173,1904
,4886,2733,3244,5400,990,4556,2892,6187,3192,434
5,1766,5
209,2681,3273,4778,1469,5410,2759,6242,3408,4669
,1495,4507,2301,5649,3134,1659,6659,2739,4899,33
54,4885,
1956,5644,2872,4805,3215,1711,6232,2950,5316,317
5,4461,1927,4536,2734,6284,1005,5261,2788,3250,4
724,184
9,5221,2898,4785,3366,6174,1524,4470,2423,5267,3
165,1870,4519,2492,6290,3716,4562,1769,5296,2518
,4889,32
74,6215,1850,2531,5262,3664,4346,1756,4467,2463,
5650,3395,6406,1470,4577,2533,3464,5441,959,4670
,2953,64
09,3369,4509,1986,5151,2843,4699,3842,6305,1960,
2521,5320,3179,4462,1499,4564,2682,5210,3252,672
0,1877,4
751,2792,5665,3223,1891,4996,2900,6189,3281,4901
,3008,5412,1661,4711,3356,7184,2913,5442,1931,47
80,3720,
2741,4806,1011,6244,3166,5652,2845,4525,1511,538
3,3276,6784,2954,4890,1719,4348,3370,5269,2763,1
770,446
9,3472,6195,2855,5222,1852,4701,3680,4944,2522,6
292,1777,5225,3424,4786,2684,5424,1878,3397,6190
,2742,48
09,1881,5416,3605,4728,2302,6219,1013,4578,3227,
5283,2765,4902,1528,6410,3282,5212,2623,3377,452
3,1823,5
000,2961,6417,3619,5167,1279,4510,2846,5387,3372
,6661,1988,4319,2859,4759,3181,5505,1933,6248,24
27,4788,
3256,1743,5666,2745,4931,3606,6306,1501,5444,247
9,4715,2655,4568,2537,6197,1939,5328,3609,4551,2
914,550
6,895,6337,3187,4892,2771,4905,1662,3239,5270,25
34,7200,1772,4810,3297,5273,2956,4817,1968,6296,
3398,528
5,2766,4933,3378,4812,1893,6221,2861,5226,3844,4
960,1515,5175,2524,6308,3229,4906,1723,5448,2904
,4702,37
28,6912,1778,5008,2887,3401,5656,1882,4818,2773,
6412,3182,5697,2746,4792,1006,5668,3189,6418,296
2,4473,1
502,4531,3284,5233,2800,6662,1992,4913,3243,5274
,2916,4415,3848,6198,1407,5199,2867,4717,3402,53
89,1934,
6227,2862,4908,3298,4580,1839,5228,2487,6201,362
1,4526,2000,5698,2977,4934,3610,6665,2538,5344,1

894,476
3,3459,7171,2671,4584,1941,5286,3380,4335,2719,6256,1014,5639,3288,4474,2787,5672,3488,6279,1751,4555,29
64,5315,3343,4718,1517,6222,2511,4723,3351,5390,2891,1897,4533,6433,3230,5761,2429,4476,1725,6338,3409,5
643,2545,4914,1955,5395,3622,6229,2978,4557,3744,4592,1780,5700,2869,6420,3190,4765,1884,5411,2774,6666,
3404,4775,1523,5179,3651,4820,3009,6202,3612,5289,1755,4937,2920,4725,3461,6312,1017,5680,2540,4447,324
5,5234,2679,7173,1847,4563,3193,5397,2777,6283,1946,4534,3625,5276,2748,4833,3271,6243,1898,5207,2491,43
47,3856,5317,1942,6230,2789,4558,3251,4538,2893,6204,1526,5236,3300,4537,2968,5290,1957,6424,4565,3410,5
181,2430,6233,3384,4343,1767,5651,2870,4779,3776,6434,1784,5645,3462,4938,2899,5762,3246,6673,1905,4834,
2778,4995,3626,6668,1018,5401,2546,4766,3653,5398,2928,6340,1518,4879,3465,2790,1726,5646,3355,7232,249
3,4945,3194,5297,1945,4916,2519,6285,3520,5413,1525,4824,3425,6245,2683,5508,3633,5024,1900,5211,2980,62
91,3275,4887,2735,4463,1871,6320,3135,5704,2951,4997,2016,3412,5889,2873,6286,3466,4726,1471,5318,2548,6
674,3599,4781,1757,5292,3654,4940,2894,6465,3628,5240,1851,4729,2793,6175,3253,5321,2874,4807,991,5456,3
367,6344,2780,4349,1958,5182,3357,7177,2494,4787,3304,5402,1906,4920,3196,6234,3010,5263,3277,4998,1961,
6689,2984,5223,3254,4782,2523,4836,1987,6436,3715,5298,2901,4946,1771,6466,3634,5414,2915,4471,3358,667
6,1529,5213,3657,4540,2685,5764,3371,6407,1879,4566,2955,5322,3426,6293,2535,4579,1948,5712,3283,4511,27
43,6246,1758,5443,3473,4581,3257,6249,2794,5512,1853,5001,3468,7174,2876,5417,3416,4891,1020,5890,2801,6
448,3658,4569,2902,5227,1989,6440,3717,4730,3665,5300,1962,6307,2905,4840,3607,5271,2552,4948,1908,6236,
3312,5329,2847,5056,3278,6191,1530,5404,3167,4961,2303,6411,3399,5768,1773,4789,3012,6529,3636,5214,295
7,4893,1969,5324,3872,6690,2767,5002,3474,5418,1990,6468,3428,4811,2525,5520,3379,7185,1779,4903,2963,57
28,3373,4570,2686,6352,5472,1883,4732,3489,6530,3285,5445,2796,4790,1964,6294,3640,5653,2992,4350,3904,6
297,1854,5275,2917,4813,3660,6309,3258,5330,1935,4671,2539,5425,3718,6250,2747,5009,1007,5667,3476,6199,
4894,3299,5420,2802,7178,1895,4907,3968,5229,2906,6472,3666,4475,1663,5304,2526,6680,3490,4793,3374,565
4,1912,4527,3016,6721,3721,4703,2431,4585,6692,1503,5657,3843,4962,2958,6257,3432,5235,1970,4819,3611,62
98,2863,5287,3183,4582,1774,6223,3024,5345,3403,5004,3286,6413,5446,1993,4814,2918,5426,3381,7186,2965,4
909,1532,5892,3260,6252,3521,4572,2775,5277,1885,6722,3289,4952,5776,2541,6368,3480,4935,1781,5449,2921,
6310,3681,4821,3668,5230,1994,6663,2749,4794,3623,5237,6696,2979,5010,3722,5332,1943,6339,3301,4848,280
4,5291,3231,7296,1015,4964,2908,5896,3492,6414,4915,3382,5450,1899,6785,2547,4910,3613,5346,2779,4535,18
86,6667,3845,5669,5025,3682,6419,2871,5658,3729,4586,1782,6724,2970,5507,3405,4719,3191,6435,1972,5428,4
767,2922,6203,3672,5336,2966,4835,2001,7180,3411,5536,3290,5012,2550,6313,5391,1947,4559,3440,6704,2981,
5399,3724,4939,3302,6258,1996,5278,4477,2791,6421,3463,5457,3385,4593,1785,6300,2808,5670,3522,5026,623
1,2929,5792,1901,4917,3614,6341,3406,5238,2542,4822,3305,7201,5452,1976,5699,2750,6260,3627,5057,3846,63
14,1519,5660,2969,4968,6205,3247,5509,2549,4588,3195,6675,1727,5293,3730,4727,6669,2924,5241,3684,4825,1
959,6786,3413,5673,2895,4796,3849,6425,5319,3040,4539,2002,7233,3292,5904,3386,4837,2495,6422,5299,1019,
4941,3496,6670,3467,5348,2781,5016,6321,3745,5458,1907,4478,2875,6437,3655,5432,3427,4918,6532,1786,582
4,2982,6235,3359,5510,3255,4947,2930,7188,5294,1527,4826,3306,6728,2985,5674,3197,4594,6913,1949,5701,36
29,4976,3011,6342,3732,5513,3688,4838,6316,1902,5403,2795,4541,3414,6264,2553,5242,6345,3388,4567,1759,5
568,3313,6480,2903,5473,4731,3850,7424,2017,5681,3635,5028,2972,6206,5323,3417,4783,2782,6426,1909,5183,
3524,4999,6287,3469,5460,2877,6247,3475,4921,1963,5514,6322,3279,4596,3013,5647,3746,6438,2018,5702,494
2,3630,7202,2986,5676,3857,4841,3504,6237,5301,2004,6788,2932,4922,3429,5415,6346,2554,4828,3259,5405,19
50,6736,3308,4542,5352,2797,6467,3736,5244,3696,7192,5058,1788,5325,2993,6536,3659,5032,3852,530
2,6441,3
014,4571,1965,5763,3777,6914,4949,3198,6251,2803
,5682,3314,4963,1991,6324,5406,2907,5705,3637,62
95,3470,
4733,5419,2988,7204,1021,5003,3418,6353,5474,352
8,4583,2878,6428,1910,5331,4791,3430,6792,3477,5
521,295
9,6238,3375,5305,4842,1855,6348,3641,5516,2919,4
924,6442,3316,5464,3667,7175,1971,4849,5706,2687
,6544,32
61,4950,3638,5765,6752,2936,5713,1531,6496,3748,
4953,5655,3433,6469,2527,4600,3778,5360,6677,191
3,4895,3
661,7297,2994,5326,5215,3287,6299,2798,4351,5447
,3858,6354,2008,5060,3719,6449,5684,3017,5005,34
20,6691,
3491,5920,4815,1775,6444,2556,5522,3478,7234,547
6,3536,4573,2909,6253,5427,1966,5011,3752,6328,3
873,542
1,6678,2805,4734,3434,5537,2020,6681,5333,3662,6
259,3018,4844,5688,3481,6311,3642,5040,1995,5952
,7680,29
67,4965,3860,6369,3669,5708,5306,3644,6470,2923,
4587,6450,1914,5766,3291,4795,3383,6916,5524,291
0,5347,3
780,6301,4850,1533,7179,3670,6016,2806,4954,6800
,3673,5714,3723,6473,4574,1973,5538,2996,6254,54
22,3493,
5064,3864,6261,3025,5769,6356,3874,4479,1997,589
1,7208,3683,5006,2971,6315,3674,5480,5659,3482,6
920,202
4,4911,6474,3020,5231,3303,5072,6370,3760,5451,2
809,6693,5334,1916,4966,3725,7236,3320,5429,6682
,2925,50
13,3441,5308,6531,3262,5569,1974,6452,4823,3436,
5337,3000,6360,4589,3726,7298,3731,5528,4969,188
7,6560,2
543,5729,3407,6415,5716,3552,4797,2751,6423,5671
,3387,6302,1783,5027,5770,3293,6481,2983,5349,71
87,3442,
4852,3685,5279,6694,3026,4956,1022,6816,5540,349
4,5430,3497,6262,4595,3523,6476,2931,5661,4827,2
032,672
3,3686,5893,7181,3615,5730,2810,4919,6684,3307,5
777,3484,6533,5018,1534,5453,2551,6317,5239,3415
,6265,34
44,4970,5720,2973,7216,3847,5014,6697,2003,5459,
3389,6343,5338,3294,4598,2926,6928,5488,3498,632
3,3525,5
029,5772,1977,7182,2783,5350,6372,3309,4839,3631
,5511,6482,3905,5433,1787,6456,4856,3041,6848,55
70,3876,
4977,3784,6534,5662,2933,7240,3906,5454,4590,199
8,6318,3733,5353,6698,2987,4798,3880,6725,5675,3
851,589
4,6537,3689,5017,1978,7425,5295,3042,4597,3676,6
427,5243,3505,6266,3028,5778,6592,3792,4972,1903
,5732,64
97,3888,5461,7189,3908,4943,2974,5897,6705,3419,
5088,3969,6347,5340,2005,6207,5434,2812,4543,331
5,6484,5
544,3734,7300,3526,5515,6538,2989,4829,5793,2006
,6671,3390,4923,6726,3747,5703,3015,6700,5475,36
90,5030,
6325,3970,5407,1951,7203,5303,3853,6439,2934,497
8,5354,3448,6429,5033,3500,6376,2879,5245,6268,3
737,567
7,2019,5059,7426,3808,5780,6349,3639,5736,2995,6
326,4843,3912,5462,6787,3697,4601,1789,6706,5436
,2555,71
94,5361,3310,4951,3431,6430,5898,3529,6729,5683,
2937,6443,1980,5020,7681,3471,5465,4830,3859,649
8,3663,5
572,6355,3032,5517,6545,3750,4925,3506,5523,6329
,1911,5327,7248,2799,5061,3749,6540,5794,3421,64
88,5678,
3317,5034,2990,6730,5905,2009,6789,5552,3530,720
5,3738,4980,5477,3692,6737,4602,3044,6679,3435,5
307,638
4,3199,5356,6350,2021,4845,3263,5784,7193,3019,5
744,6239,3854,5041,6471,3479,5707,2938,6708,5900
,2010,50
62,7190,3508,5825,3698,6944,5246,3643,6546,4851,
2557,6500,5362,3537,4955,3753,6451,5685,1967,730
4,5518,3
318,6445,5036,2997,6561,3779,5466,6357,3422,5576
,4926,3671,6712,5478,3021,7428,1915,5525,6976,37
40,5007,
6732,3862,5423,5689,3532,6330,3048,4967,7432,332
1,5364,6790,3754,5715,6548,2022,4735,3645,6371,5
309,294
0,5686,7040,3483,4984,7206,3875,5796,6738,3861,5
481,1790,6562,4575,2998,6446,5826,3781,7682,5709
,3437,50
42,3512,6793,5335,2911,6915,4846,3700,6504,5906,
1535,6683,5767,3761,7264,3446,5065,6255,2807,546
8,5539,3
495,6475,4604,3538,6358,5526,3865,7235,5584,3056
,6453,1023,4957,6332,3322,5800,6593,3443,5921,48
53,3553,
7209,5482,2558,6361,5710,3646,6552,3485,5066,675
3,2012,5529,6740,3675,5690,7312,3027,5015,6695,3
438,590
8,5717,3540,6794,3727,5692,6373,3001,4971,7196,2
025,5339,6303,3972,5431,6564,3877,4958,6454,3687
,5828,72
37,2811,5718,6685,3756,4854,3782,5721,6917,1975,
5771,6754,3501,5044,7210,3022,5541,6801,3866,591
2,6477,3
324,5073,6263,3445,5922,7684,3677,5731,6744,3002
,5019,6483,2026,5722,3920,6362,5530,3762,5068,72
17,3785,
5351,6512,2927,5808,6796,3704,4857,6374,3554,577
3,7242,1917,5368,6535,3878,4973,6457,3029,5489,6
594,349

9,5310,7440,3976,5484,6686,3486,5048,6478,3030,5774,6377,3295,5779,1999,4591,7328,3735,5455,6699,3764,5600,6918,3907,4799,6319,2975,5435,7688,3691,5341,6267,3544,5031,6802,3527,5490,6756,1918,5733,7456,3043,5074,6485,3868,5542,6921,3881,5545,6364,3786,5571,7696,3793,4979,6458,2813,5734,6568,3909,5663,6539,2033,4858,7360,3788,5355,6817,3936,5532,6727,3004,4599,6499,3882,5463,7712,3678,5492,6431,3984,5021,6327,3794,5895,6378,1979,5437,7238,2935,5342,6269,3768,4974,6701,3449,5546,6804,5573,3507,7212,4831,3889,6760,5357,3033,6486,5679,3391,6460,5953,2028,7299,5089,3693,6385,5924,3884,6922,5832,3045,7249,4981,3556,6707,5954,3502,6489,5781,3910,6596,5035,3739,7218,5928,2034,6541,5899,3034,6547,5737,6351,3560,5090,7241,3311,5724,6818,3450,5553,6702,3531,5076,7183,2991,5840,6929,3694,5936,6576,1981,5956,6501,3699,5022,7488,3509,5467,6331,6017,3452,6380,4860,2939,6808,5363,3890,7301,5782,3533,6768,5574,3568,6731,5037,3741,7220,5438,2007,6924,5795,6849,3046,5063,6270,3751,5738,7191,3796,6018,6386,3913,5901,6709,2814,4982,5496,3701,5548,7302,4927,3423,6542,5785,3539,6490,5856,1982,6600,5687,3510,7552,5043,2559,6502,5960,6549,3809,5745,7244,3323,4603,6447,3534,5358,6713,3514,5479,6388,3513,5577,7305,4985,2011,6739,5519,3036,6333,5907,3541,7250,5711,3319,6710,5080,3755,6820,5798,6505,3914,5554,7224,3049,4847,6850,3810,5797,6733,3971,5469,7195,5365,3742,6359,5038,2036,6930,5578,3855,6791,5786,2999,7265,5740,6492,3921,5092,6563,3892,5483,7207,3800,5247,6550,5311,4000,6608,5067,3050,6824,5902,3863,7427,5527,2023,6945,4986,6506,3439,5556,7252,3973,5746,6734,3702,5691,6553,4605,3757,7306,5585,2941,6714,5801,3916,6932,5366,6741,3705,5045,7313,3783,5827,6716,2040,5470,6363,5719,3325,7429,5069,3023,6455,5788,3763,6852,5910,7197,3896,5580,6742,3974,5096,6745,5369,3758,7211,5802,2942,6795,5693,3812,6565,4988,6936,3922,5531,7266,1791,5923,6946,3447,5909,6755,5046,3516,7683,5829,3542,6746,5485,6554,3057,5560,7256,3555,4959,6375,3487,6832,5748,7308,3557,5809,6797,3977,5494,6392,4855,3867,7198,5543,2013,6513,5586,6334,3003,5913,6508,3545,5104,7314,3706,5370,6798,5491,3816,6803,5601,3924,7239,4606,6479,4032,5694,6624,3052,7430,5533,6459,3937,5723,6365,3765,5075,7433,5486,2027,6514,5588,3869,6757,5775,7329,3978,5049,6566,3058,6020,6569,5925,3787,7744,5735,3879,6595,6758,4859,3546,7213,5804,3708,6687,5830,6379,3766,5549,7268,3005,5070,6556,5914,2014,6487,5372,3326,6516,5493,7808,3789,6919,5725,6461,3647,5050,7219,3985,5968,6366,5810,3870,6570,5833,3031,7316,4975,6597,3883,5752,6381,3451,7214,5602,6703,3769,5926,6977,5077,3503,7243,5547,2029,6948,6024,6856,3679,5534,7434,3561,6978,5078,6805,3006,5343,7441,5783,3938,6952,5812,3795,6923,5955,7685,3558,5023,6761,3980,7272,5739,6748,3790,5592,6577,5575,3035,7330,5091,3885,6864,5916,6960,1983,5929,7221,6980,3548,5834,6491,3928,5841,7361,4861,3911,7041,5957,6387,3797,7320,5836,3060,6806,5984,6598,3770,5052,7245,5930,3986,6462,5726,6819,3824,7332,6032,3940,6762,5842,7042,3891,4983,7936,5816,2035,6925,5497,3886,6520,7436,5555,3047,6572,5937,7442,3511,5081,6809,5439,4001,6880,7686,5741,3562,6711,5932,3695,6984,5093,7222,3743,5604,6769,6382,3811,5550,7251,5958,3064,6503,5787,3988,6601,5082,7225,3535,6543,5608,6931,2037,5359,7689,5498,3915,6735,7280,5579,3453,6822,5039,3569,6578,5742,7303,2815,5747,6821,6493,4002,5557,7246,5500,3893,6389,4987,6602,3798,7457,5938,6810,4033,5581,7362,5616,3944,6764,5789,3564,6507,7253,5094,3703,6271,5799,6335,1919,5844,7444,6926,3037,5961,7690,4862,3801,6551,5749,6580,3772,7226,5471,6770,3515,5587,6715,5558,3813,7336,6609,4607,3917,7307,5857,6825,3992,5371,6390,7267,3051,5582,6851,5562,3454,6494,5561,7254,3894,6743,5084,7228,3923,5589,6812,5367,3802,6934,7448,5803,2030,6604,5962,6393,3570,7257,5097,6826,3952,5858,7458,6019,3038,6717,6555,5790,3814,7697,5903,6947,3517,5047,6933,7692,3543,5969,6853,5940,3707,7364,6509,5848,4004,6584,6048,7309,3759,5098,6772,7269,3975,5911,6833,5487,3053,6518,7315,6021,3897,6567,5750,6610,2038,5805,7344,6937,3572,4989,7310,5964,3918,6394,6515,5753,3817,7698,5831,6625,7489,3898,5373,6718,5071,38

04,6557,
5811,7199,3518,6747,5944,7368,3007,6022,6510,6612,4034,5806,7258,4990,4008,6799,7713,5860,3547,7044,597
0,6949,7460,3925,5495,6759,5564,3939,7490,6828,5590,2041,6854,5105,7700,3709,6573,5603,7431,5535,3979,69
38,6396,5605,3059,7317,6025,6517,3559,7270,5915,6749,3767,5051,6992,7273,5593,3818,6834,5754,7472,3900,6
857,5864,7464,3825,5972,6776,6626,3926,6080,7331,5100,6950,3929,7260,5985,6571,3061,5813,7048,7215,3576,
5917,6558,6026,7435,3871,6367,5106,6807,3327,5835,7553,6836,2042,5927,7714,6979,5594,4036,7492,5756,676
3,3981,6616,5814,7376,3791,5053,6599,7554,5374,3549,6940,5837,6953,3987,7318,5695,6858,7321,2943,6033,68
65,5918,3710,7333,6981,5079,3820,6860,5931,7274,7008,4016,5499,7223,6954,3941,5817,7496,5551,6750,3563,7
056,5727,7704,3771,5609,6866,7745,5054,3826,6840,7716,5986,3930,6521,5843,6579,7281,2015,5606,6961,7322,
3054,6028,6463,5838,7247,3550,6765,5083,7437,4040,6956,5933,6628,5596,3455,7276,6574,5976,7746,3982,698
2,5959,7392,3887,5845,6811,6632,5108,4048,7334,6383,5818,3942,7687,6034,6522,7720,3989,5872,6603,7363,59
88,3062,6766,5939,6771,3799,7438,5934,6581,7809,3565,5095,6524,5559,3945,7691,6962,6049,7443,3773,6605,5
610,6640,7748,4003,5743,6813,5791,7459,2044,6823,5859,7227,3828,6868,5112,7337,6985,3932,6036,6773,5583,
7728,3571,6495,5963,7282,3803,6611,5501,7445,6582,3065,5617,7324,6881,4863,3895,7255,6050,6395,7365,399
4,5941,6606,6586,5846,3946,7284,6585,6081,3990,7338,5992,6613,7229,3574,5612,6391,7699,5751,4005,6827,76
93,5085,6986,3815,7810,5849,6882,7043,3832,5820,7449,5563,6814,3953,7446,5861,6927,7694,3066,5965,6993,7
345,6040,3566,6964,7461,5099,2031,6872,7556,5502,7072,3774,7259,5942,6935,5971,3993,6511,7752,5850,7045,
3573,7937,5618,6774,7366,3948,6000,6829,7340,5086,3919,6988,7288,5862,6777,4064,7369,5565,6855,7504,351
9,5591,6397,7230,5755,3805,6835,7450,6052,6968,3899,7311,5807,7046,7271,6023,3039,6830,5101,6884,7346,40
06,5945,6994,7462,5620,3954,6519,7261,5966,6588,4009,7812,5865,6614,7370,4035,5946,6627,7760,5852,3819,6
559,7491,5566,6629,3577,7560,5055,7049,7465,6082,3927,6939,7938,6056,6617,2039,7275,5595,6778,7348,3996,
5973,6888,7319,5987,3806,6996,7377,7104,5757,7452,3901,7009,6027,7816,6837,3068,5107,7262,6941,5607,403
7,7372,7050,5815,7466,6859,4010,5866,7568,6951,5948,3956,7776,6618,5873,7520,3578,6780,5974,7493,6838,59
77,3821,7701,6398,5109,7323,4017,6861,5624,7378,6719,4038,7473,5919,7057,7715,5375,3827,6942,7468,6084,6
955,3931,7277,6029,6523,7352,5839,4012,6841,7702,5597,6575,3902,6751,6633,6035,7705,7010,3983,4991,7283,
6867,5758,3055,7335,6630,5868,7393,7052,3943,6064,7494,6862,7474,3711,5989,6957,7940,5611,6620,3960,732
5,5819,7000,7824,5874,2043,6983,7497,5978,6869,3551,7278,6842,5102,7285,7058,4018,5598,7380,6896,6088,73
39,3822,7012,7944,5503,6963,4041,7498,6030,6958,7394,5935,3580,6583,7717,6096,7073,7706,3933,6634,5990,7
555,6767,6037,3829,7476,6815,5110,7384,6883,4042,7584,5847,7060,7439,3991,5613,6607,7447,6987,5993,3063,
7326,6525,5821,7505,6641,3947,6051,7718,7074,7840,5876,3934,6965,7286,5980,6870,7500,3830,5619,7747,710
5,7708,5851,4020,7016,7557,5113,6636,7341,4049,6775,5943,7289,6873,6042,3995,7721,6844,7367,5994,6587,40
44,7952,6038,6885,7347,6989,3833,5622,7396,7064,6053,7506,3949,6526,7480,5863,6966,7872,4024,5880,7558,6
995,7342,6001,3567,6874,7722,5114,6642,7749,2045,7024,5614,7561,6886,5822,7451,3775,6589,7290,6041,6615,
7616,4007,5621,7521,6779,7729,5996,4050,7076,7371,6831,5967,7231,3067,7047,6112,7508,6969,7562,5567,395
5,6644,7695,5853,7750,6990,3834,7724,5947,6889,7349,6970,5087,3575,7463,6876,6054,7453,6590,3997,7400,60
02,7292,7106,7373,3950,6057,7080,7350,6619,6083,7811,3807,6997,5867,7730,7011,7454,4065,5625,7753,6781,7
467,5975,7051,3957,7522,6631,6044,7379,6839,4011,5854,7569,7353,6890,5949,7564,4066,6972,7512,5116,6897,
7754,6998,4052,6085,7813,7761,6058,7001,3998,7703,6648,6004,7408,6943,7374,3836,5626,7263,6399,7495,586
9,7108,4013,7732,7053,6065,7968,6863,7570,4039,6086,7524,6621,7475,5875,7059,3069,7469,6782,5979,7585,73
81,3958,6892,6060,7736,7088,8000,5950,3903,7013,7756,7354,6031,6635,7814,4019,6843,5103,7572,739
5,6898,5
991,3579,8064,7002,7762,5759,6622,7586,3961,7470
,6008,7112,7817,6527,5599,7939,2046,7054,7528,60
66,7707,
6959,7279,4056,5870,7120,7499,7382,6089,7014,382
3,7477,7061,5628,7356,7617,6871,4014,5981,7385,6
637,757
6,5877,7017,4068,7777,7764,6090,6845,7719,7075,7
818,4043,6039,7397,6900,7327,5111,7004,3962,7588
,7478,59
95,6643,7709,6875,3581,5982,7941,7778,6967,7825,
5878,7066,4021,7501,7287,6068,7018,7768,7062,404
5,6097,7
507,7386,6646,6043,7536,7077,4072,7820,7398,6092
,6887,7559,7481,5881,3964,6904,7618,7025,5997,77
10,7502,
4022,6638,7401,6072,6846,7723,7942,5615,3935,706
5,7343,6645,7291,5823,7826,7020,3831,7780,6055,7
509,699
1,7945,7136,6098,3070,7388,7482,6591,5115,7592,7
563,6877,4080,7841,6003,6971,7751,7523,5882,7078
,3582,74
55,7351,7026,5623,7402,7081,7293,4051,6045,7725,
7107,7828,7784,5998,6891,4025,7510,6649,7484,585
5,7409,6
999,7946,3835,6113,7731,7068,7513,6878,6005,7620
,4046,7565,6973,7571,6059,7375,7109,7842,4026,61
14,7726,
7082,7953,7600,6100,7028,7525,3951,6650,7355,604
6,7404,6893,7832,7792,4053,5884,7089,7755,7948,7
110,606
1,7873,7294,4054,6899,7410,6087,7003,7733,7566,7
084,3999,5117,7514,7624,6974,6006,7526,7573,7055
,4067,74
71,5951,7737,7015,7412,7763,6067,6783,3837,7357,
7734,7032,5627,7844,7529,6623,4028,7874,6009,775
7,7090,7
383,6894,7954,6104,3959,7815,7113,7516,7587,5871
,6652,7574,7632,4057,7005,6062,7848,7969,6901,75
30,6116,
7758,7114,4069,7577,7738,6091,7063,7956,7765,774
0,7019,2047,6010,7387,7479,7006,7876,5629,7766,6
902,405
8,7769,7819,6069,7092,7589,7960,7121,7970,4015,6
093,7779,7067,7770,7578,6120,7116,7399,7856,3963
,6905,60
12,7821,7416,7021,7537,7358,6070,4070,7532,7096,
7822,7827,5983,6639,7503,7648,6847,3838,7483,587
9,7389,7
079,7538,7781,7122,5118,7590,3583,7593,7619,7027
,6128,7782,7711,6906,7403,7580,3071,5630,6647,75
11,7540,
7069,7943,6099,7485,7390,4060,7022,7594,7621,607
3,6879,7405,7727,8001,5883,4073,7137,7972,7880,7
029,800
2,6094,7829,7083,7976,4023,7947,7785,6074,7138,7
772,7601,7124,7888,5999,7984,4074,8004,7070,7515
,8065,61
01,6908,7411,7830,7622,7085,3965,6102,7486,7843,
7111,7786,8066,6047,7949,7030,4047,7544,7596,697
5,7833,6
115,7904,7735,7091,8008,7793,3966,5885,6651,7406
,7527,7625,7033,6076,7567,7955,7759,4081,7128,78
46,7602,
6007,6895,7845,7517,7413,7086,6105,4027,7626,783
4,7788,7140,7531,7295,6117,7359,7115,7950,7575,4
076,703
4,6106,7604,7794,7739,6653,7633,7849,6063,7414,4
082,7093,7875,7518,7767,7117,6011,7836,7958,7628
,7144,74
17,4029,7850,6118,7741,7036,7579,7971,7957,5886,
7094,7877,7533,4055,7608,7007,7796,5631,7857,754
2,6903,7
591,7634,7961,7152,4030,5119,7418,7539,7649,6654
,7742,7581,6108,7771,7123,7534,7636,4059,7823,70
97,6121,
8068,7973,7783,6907,7852,7878,6071,7597,7118,408
4,7962,7420,7541,7773,7098,6122,8016,7858,7881,7
023,780
0,4071,7650,6013,7974,7125,7595,8072,7582,7126,7
391,6095,7831,7860,8003,4088,7071,7787,7640,7623
,6014,71
39,7964,7977,7882,7889,6909,8005,3839,6129,7884,
8032,7100,7978,7774,8080,7890,6075,7031,7864,754
5,7603,4
061,7985,7129,7487,6124,7789,7980,7141,7652,7598
,8006,7835,6130,7130,4075,7656,7407,7546,7627,70
87,7790,
6077,7795,7605,7548,7035,7986,7629,7664,4062,783
7,6103,7142,7847,7892,8009,6910,7797,7519,7635,6
078,760
6,6655,4077,7905,7419,7630,7610,7609,6107,7132,7
637,7415,7851,8010,7145,7906,8067,7838,4031,6132
,7951,70
95,8017,7988,7896,8096,7146,7959,6119,7535,8069,
7798,7853,7037,4083,8012,7801,7879,6136,7421,711
9,7859,7
992,8070,7854,7038,7908,8018,5887,7543,4085,7612
,7638,7153,7651,7583,7653,8073,7963,6109,7099,76
41,7802,
7912,8020,8128,7148,3967,8033,7861,6123,7965,807
4,7154,7883,7975,7642,7804,7862,7101,6110,7422,7
885,774
3,4078,8081,7966,7127,7979,7547,7865,7599,6125,7
775,7657,7102,8034,7891,7654,8076,7886,7131,4086
,7981,60
79,7644,8024,8007,7893,7156,7866,8082,7920,8036,
7987,6131,7982,7143,7607,8097,7658,4089,7791,783
9,7907,7
160,8084,7631,6133,8011,7549,7665,6911,8098,7989
,7894,8129,8040,7660,7799,6015,4090,7133,7897,78
68,7611,
7909,8013,8088,7147,7550,7990,8019,7898,6126,766
6,8048,7134,7910,7613,7639,7803,4063,8100,7855,8
071,714

9,7993,6134,7668,8014,7913,7994,7900,7614,7103,8130,8104,7643,8021,8035,6137,7805,4092,8075,7155,7655,7863,7914,7996,7921,8022,8025,7157,7672,7967,7423,6138,8132,8077,7887,7645,8083,7039,7806,7916,8112,4079,8037,7659,7867,7922,8026,6111,7150,7646,8136,7551,8078,7983,8144,8038,8085,7158,7895,7661,8041,7869,8099,6140,7924,8028,4087,7667,7899,7161,7991,8090,8042,8086,7670,8101,7911,7928,8049,7162,7662,6127,7870,8089,7669,8044,8015,8160,7615,7901,7995,7135,8102,4091,8050,8105,8131,7915,7673,8023,6135,8092,7902,7997,7164,8133,8106,8052,7674,7917,8113,8134,7923,8027,8108,7998,8079,7151,8039,7807,8056,6139,7647,8114,4093,7918,8137,7676,8029,7925,8138,8087,7159,8043,8030,7926,8116,8145,8091,8140,7929,8045,8120,7663,6141,7871,8103,8146,7163,8051,7930,7671,8093,8046,7903,8161,8053,8107,4094,8162,8148,8094,7932,8109,8135,7165,8054,7999,8115,7675,8057,6142,8152,7919,8110,8164,8139,8058,7677,8117,8141,8168,8060,8118,8031,7927,7166,8176,7678,8147,8121,7931,8142,8122,8047,8149,8150,8095,4095,8163,7933,8124,8055,8153,8165,6143,8154,8111,8059,8166,7934,7679,7167,8156,8169,8119,8170,8061,8143,8062,8177,8123,8172,8178,8125,8151,8126,8155,8180,8167,8184,7935,8157,8171,8158,8173,8127,8179,8181,8063,8174,8182,8185,8186,8159,8188,8175,8183,8187,818 9,8190,8191]

**Sequence group 3: Z3_8192**

[0,1,2,7,3,8,14,27,4,13,16,31,19,36,38,84,5,15,17,35,22,42,52,89,25,51,46,97,63,106,113,182,6,20,24,44 ,26,50,57,99,32,61,65,107,78,120,126,201,37,67,82,124,87,135,145,215,96,147,160,243,166,257,281,408,9,21,29,60,33,64,77,115,39,83,69,127,92,139,153,224,49,80,95,146,101,156,165,251,111,168,186,269,200,288,307,454,59,98,109,164,122,176,194,284,133,195,214,299,227,325,343,494,150,222,247,330,254,344,371,528,275,378,402,556,423,581,627,877,18,28,34,79,43,86,90,151,54,94,102,163,112,175,179,283,62,103,114,177,125,193,211,301,138,212 ,223,319,249,339,364,516,71,118,134,199,140,213,230,331,161,245,255,347,274,377,394,553,178,266,285,385,300 ,417,426,578,327,440,475,615,501,649,725,878,75,136,155,233,173,252,273,382,183,277,291,407,308,425,452,603 ,208,304,320,437,345,468,496,662,358,504,533,690,564,738,767,1022,229,334,352,479,387,513,538,715,422,548,579,755,616,773,842,1103,451,592,630,809,645,865,897,1175,720,914,951,1160,990,1235,1333,1678,23,40,45,100,55,104,116,192,56,117,129,202,142,225,236,362,70,130,143,240,157,248,263,363,167,261,282,400,305,421,432,577,73,154,169,242,188,267,286,420,198,297,309,434,323,466,486,643,197,321,336,463,357,500,518,694,389,542,566,737,589,764,816,1081,85,181,190,293,206,316,335,456,217,342,351,495,372,527,547,733,279,365,388,532,409,562,588,760,443,597,635,805,667,862,901,1147,313,404,436,574,462,613,638,845,491,655,677,874,726,931,966,1211,535,724,742,952,761,992,940,1257,826,1074,1107,1355,1121,1459,1518,1755,91,203,209,356,268,376,392,541,295,397,412,569,442,601,634,849,311,439,461,602,478,641,670,884,505,682,713,921,757,960,1019,1270,361,467,484,668,517,703,745,943,567,746,769,1014,830,985,1092,1361,611,797,858,1075,885,1117,1154,1426,932,1168,1165,1503,1260,1547,1599,1928,403,502,543,750,599,772,814,1037,636,847,867,1110,912,1128,1163,1452,672,893 ,945,1150,967,1172,1264,1552,1034,1284,1322,1613,1390,1696,1745,2117,734,955,1008,1267,1089,1273,1376,1634,1101,1365,1433,1725,1488,1791,1886,2269,1129,1463,1535,1824,1577,1902,1857,2323,1667,1977,2030,2480,2145,2568,2678,3005,30,48,58,110,66,131,144,231,72,148,159,239,172,259,264,413,74,170,180,258,191,317,328,450,218,329,355,492,375,520,545,754,76,187,204,322,220,353,368,510,232,381,395,551,416,582,608,775,246,406,430,595,457,631,652,836,469,644,684,890,689,920,957,1340,119,219,228,373,241,396,414,572,271,433,445,622,474,658,680,853,292,449,483,648,508,687,697,905,531,699,712,962,796,996,1062,1363,312,507,523,708,558,743,751,977,587,792,820,1033,873,1084,1112,1437,621,841,889,1115,936,1143,1218,1492,1006,1228,1288,1557,1326,1626,1705,2102,123,238,260,427,289,446,477,664,306,488,511,702,536,719,728,970,341,526,557,731,585,785,813,1023,617,832,869,1098,907,1133,1190,1441,369,571,606,818,654,861,857,1136,674,895,916,1178,981,1222,1248,1564,716,938,1000,1239,1027,1305,1329,1638,1070,1358,1405,1729,1499,1802,1892,2278,391,626,657,900,695,928,982,1231,781,1004,1046,1316,1053,1336,1383,1689,799,1048,1067,1372,1138,1401,1474,1788,1203,1495,1532,18
28,1595,1936,1996,2352,834,1156,1185,1445,1249,1507,1543,1869,1292,1586,1644,1973,1711,2038,2130,2512,14
12,1653,1736,2060,1814,2160,2203,2654,1876,2243,2315,2718,2421,2834,2985,3484,141,272,298,489,337,521,55
2,763,349,563,593,790,624,825,881,1193,383,610,663,851,686,925,909,1210,705,947,989,1281,1041,1309,1347,16
71,460,676,707,924,780,975,1011,1319,789,1042,1060,1351,1088,1387,1424,1765,801,1078,1124,1420,1199,1471,
1522,1835,1241,1573,1591,1940,1648,2004,2079,2459,471,778,784,1029,804,1051,1095,1398,837,1142,1181,1456 ,1224,1510,1582,1917,997,1197,1253,1528,1294,1616,1657,1984,1394,1663,1739,2064,1818,2153,2195,2640,1056 ,1301,1368,1620,1416,1719,1776,2094,1484,1795,1847,2187,1910,2251,2343,2760,1539,1880,1954,2306,2026,237
2,2453,2866,2109,2491,2557,2952,2616,3109,3149,3832,480,808,822,1186,972,1215,1245,1568,1015,1277,1312,1
630,1379,1685,1759,2087,1064,1344,1409,1699,1448,1781,1851,2177,1514,1898,1840,2227,1992,2332,2413,2803,
1206,1430,1467,1807,1561,1862,1946,2286,1609,1958,2018,2381,2072,2433,2524,2934,1715,2045,2124,2471,221
0,2580,2628,3065,2262,2704,2747,3199,2848,3272,3331,3683,1298,1481,1605,1965,1681,2011,2052,2442,1750,21
38,2169,2548,2234,2592,2730,3129,1769,2219,2295,2692,2401,2774,2787,3300,2503,2883,2915,3359,3027,3524,3
596,4162,1921,2364,2392,2817,2536,2897,2971,3420,2604,3047,3085,3560,3225,3639,3888,4347,2666,3174,3247,
3730,3387,3776,3946,4458,3454,4014,4085,4599,4244,4770,5021,5420,10,41,68,149,88,162,196,310,105,184,216,
340,244,374,386,609,121,207,226,366,270,405,459,628,294,453,431,660,514,696,722,961,137,253,287,418,302,44
8,482,669,346,503,525,700,586,752,774,1018,379,534,600,766,623,802,840,1057,656,848,886,1137,906,1173,1236 ,1567,174,262,324,497,354,519,580,732,393,605,540,779,642,815,864,1083,441,594,651,843,678,875,904,1159,71
4,915,968,1207,1013,1259,1307,1675,493,665,706,899,756,937,994,1247,793,999,1055,1286,1090,1352,1403,1768 ,854,1076,1148,1371,1167,1406,1473,1844,1227,1494,1549,1905,1602,1961,2057,2542,235,318,360,591,411,620,6
32,859,465,647,683,894,718,934,949,1243,509,688,727,941,770,991,1043,1293,810,1047,1080,1335,1155,1392,14
58,1815,550,744,798,1010,819,1050,1102,1374,891,1141,1169,1414,1223,1490,1530,1901,946,1198,1252,1509,12
89,1588,1610,1952,1356,1643,1723,2033,1782,2105,2257,2545,570,807,870,1111,930,1161,1219,1502,964,1230,1
265,1563,1310,1606,1674,2008,1036,1296,1339,1637,1410,1708,1775,2127,1443,1789,1856,2189,1924,2284,2341,
2791,1097,1378,1425,1733,1513,1811,1866,2237,1600,1889,1956,2318,2035,2355,2483,2923,1669,1982,2062,242
4,2097,2521,2577,3034,2248,2607,2669,3011,2736,3126,3278,3795,280,398,424,675,470,693,736,986,476,739,783 ,1020,828,1085,1116,1451,544,787,831,1125,880,1151,1191,1454,910,1188,1240,1546,1300,1596,1623,1949,559,8
68,917,1134,976,1201,1255,1592,1005,1279,1313,1628,1349,1702,1749,2090,1001,1341,1384,1698,1440,1778,182
2,2192,1520,1873,1926,2281,1980,2338,2436,2886,614,956,979,1272,1032,1328,1382,1679,1061,1399,1421,1772,
1477,1841,1885,2272,1233,1462,1517,1853,1571,1914,1974,2326,1651,1995,2075,2416,2141,2518,2586,2993,132
4,1556,1633,1945,1694,2027,2082,2486,1762,2115,2163,2539,2260,2634,2695,3093,1860,2254,2289,2672,2329,27
40,2651,3163,2455,2872,2926,3309,2948,3473,3565,3908,637,1025,1039,1436,1205,1487,1527,1870,1276,1542,15
75,1933,1647,2001,2069,2494,1317,1641,1692,2005,1732,2084,2148,2554,1794,2171,2233,2619,2321,2686,2783,3
183,1447,1706,1746,2142,1820,2213,2298,2657,1930,2301,2346,2777,2456,2727,2905,3317,2023,2398,2509,2877,
2559,2945,3000,3424,2637,3023,3019,3538,3166,3607,3678,4140,1553,1785,1878,2303,1999,2349,2430,2814,207
8,2489,2527,2931,2601,2960,3016,3463,2151,2571,2660,2997,2698,3031,3171,3613,2811,3205,3261,3700,3367,38
18,3894,4381,2275,2675,2767,3179,2900,3188,3345,3736,2920,3326,3434,3863,3513,3960,4093,4559,2963,3479,3
585,4000,3650,4111,4050,4630,3782,4206,4274,4814,4414,4914,5049,5398,332,435,487,709,529,791,835,1105,55
5,852,883,1123,926,1180,1194,1578,565,922,953,1176,984,1332,1360,1665,1066,1367,1432,1763,1483,1827,1882,
2312,575,971,1028,1345,1071,1428,1466,1805,1108,1498,1534,1894,1585,1964,2016,2358,1146,1559,1619,1989,1
684,2067,2106,2468,1712,2091,2174,2565,2184,2613,2681,3286,748,1069,1094,1478,1130,1538,1581,194

2,1213,1
624,1655,2047,1721,2123,2166,2500,1269,1661,1742
,2099,1801,2181,2201,2589,1848,2205,2230,2689,23
95,2744,
2855,3322,1321,1798,1833,2224,1912,2292,2309,271
3,1970,2389,2445,2808,2533,2891,2937,3440,2042,2
477,256
2,2940,2645,2988,3101,3518,2763,3118,3208,3618,3
264,3719,3838,4364,762,1120,1182,1614,1261,1658,
1728,213
5,1304,1752,1809,2208,1864,2245,2265,2701,1395,1
837,1908,2268,1968,2378,2427,2794,2039,2462,2530
,2912,25
95,2966,3058,3443,1469,1937,2014,2439,2112,2515,
2506,2974,2156,2574,2610,3039,2721,3104,3146,362
9,2240,2
648,2753,3133,2797,3233,3269,3742,2869,3314,3392
,3869,3534,3974,4097,4570,1524,2054,2120,2583,21
98,2631,
2724,3121,2369,2757,2828,3250,2842,3281,3354,381
2,2404,2831,2863,3340,2977,3381,3498,3954,3078,3
529,358
0,4008,3672,4146,4228,4661,2465,3008,3050,3448,3
154,3543,3602,4065,3213,3661,3747,4198,3843,4282
,4397,48
52,3401,3759,3875,4306,3988,4431,4486,5006,4071,
4531,4619,5091,4736,5218,5378,5901,824,1216,1282
,1756,13
88,1831,1896,2335,1417,1918,1987,2387,2050,2450,
2551,3062,1505,2020,2133,2497,2180,2625,2598,309
0,2216,2
663,2733,3196,2820,3238,3295,3789,1688,2159,2222
,2622,2366,2710,2770,3255,2384,2823,2852,3303,28
94,3364,
3415,3920,2407,2880,2956,3410,3073,3493,3571,402
2,3138,3644,3667,4154,3753,4236,4331,4791,1716,2
361,237
5,2800,2410,2837,2908,3378,2474,2982,3042,3468,3
113,3549,3655,4127,2750,3070,3158,3574,3216,3706
,3765,42
14,3373,3770,3880,4315,3994,4422,4475,4992,2845,
3230,3336,3711,3406,3857,3934,4356,3507,3967,403
6,4467,4
119,4540,4650,5137,3591,4079,4176,4610,4266,4681
,4779,5253,4372,4826,4902,5342,4965,5524,5571,62
16,1738,
2418,2448,3053,2707,3098,3141,3635,2780,3191,324
2,3725,3350,3807,3914,4339,2859,3291,3395,3826,3
459,394
0,4042,4450,3554,4105,4028,4512,4222,4639,4724,5
184,3081,3429,3488,3980,3624,4056,4168,4579,3695
,4184,42
58,4692,4323,4747,4864,5323,3849,4290,4389,4802,
4494,4926,4979,5480,4551,5079,5122,5619,5234,569
3,5750,6
084,3221,3504,3689,4192,3801,4252,4298,4758,3900
,4406,4439,4887,4522,4940,5107,5547,3926,4503,45
90,5064,
4713,5153,5169,5721,4840,5269,5304,5776,5440,593
5,6005,6505,4133,4670,4701,5202,4875,5288,5362,5
837,495
2,5460,5504,5970,5644,6044,6268,6660,5034,5595,5
668,6125,5808,6170,6320,6752,5867,6374,6438,6866
,6579,69
95,7168,7433,11,47,81,189,108,205,265,410,132,250,
290,447,326,490,506,794,152,278,303,481,359,539,6
04,823,3
90,598,568,860,673,908,939,1229,171,338,380,554,4
01,590,633,872,455,659,685,913,765,974,1003,1299,
498,698,
782,993,811,1035,1082,1346,856,1091,1140,1442,11
66,1485,1562,1925,221,348,428,653,464,679,759,948
,515,788 ,710,1007,839,1054,1114,1377,583,776,850,
1087,882,1127,1162,1468,929,1174,1242,1525,1295,
1587,1642,2043,6
46,866,918,1157,983,1204,1271,1572,1026,1275,134
3,1618,1389,1697,1747,2139,1104,1369,1457,1710,1
479,1751 ,1823,2220,1548,1845,1906,2285,1962,234
2,2443,2972,314,419,473,771,546,806,827,1109,612,
844,888,1153,933,
1200,1217,1569,666,892,944,1209,998,1266,1330,16
25,1049,1334,1373,1676,1464,1734,1806,2191,723,9
63,1030,
1290,1058,1338,1400,1714,1144,1449,1482,1760,154
4,1843,1888,2279,1212,1515,1576,1861,1621,1948,1
972,233
3,1701,2007,2093,2417,2155,2496,2662,2976,747,10
40,1122,1411,1192,1472,1541,1855,1234,1551,1593,
1922,164
6,1969,2037,2391,1323,1632,1680,2000,1754,2076,2
146,2522,1790,2164,2231,2588,2302,2691,2752,3245
,1396,17
20,1771,2104,1868,2185,2244,2642,1960,2267,2336,
2726,2420,2764,2904,3390,2034,2365,2449,2839,248
7,2950,3
013,3515,2653,3044,3114,3489,3186,3615,3774,4278
,370,522,560,876,619,898,954,1263,625,959,1012,13
02,1068,
1380,1419,1799,717,1017,1073,1431,1131,1461,1508
,1803,1170,1500,1566,1904,1635,1957,1985,2331,73
5,1118,1
179,1438,1251,1519,1580,1953,1287,1611,1649,1991
,1690,2071,2119,2481,1283,1683,1727,2065,1786,21
52,2196,
2594,1874,2253,2308,2687,2359,2746,2853,3352,800
,1225,1254,1601,1315,1666,1724,2046,1354,1743,17
67,2144,
1826,2217,2264,2680,1554,1810,1872,2229,1929,229
6,2356,2735,2015,2376,2464,2830,2534,2943,3021,3
466,166
2,1913,1997,2325,2061,2411,2472,2910,2131,2508,2
558,2968,2665,3076,3143,3576,2238,2659,2697,3116
,2738,31
93,3095,3652,2874,3338,3397,3809,3422,3972,4061,
4378,833,1306,1327,1784,1523,1839,1881,2250,1607
,1897,19 34,2313,2012,2385,2461,2918,1656,2003,2058,2388,
2101,2475,2543,2987,2167,2567,2636,3057,2732,313
1,3240,3
674,1797,2073,2116,2537,2194,2615,2706,3099,2311
,2709,2755,3232,2878,3178,3371,3820,2408,2812,29
36,3341,
2990,3417,3477,3922,3080,3502,3497,4038,3657,410
1,4172,4596,1909,2157,2255,2715,2379,2761,2847,3
274,246
7,2913,2953,3402,3040,3432,3495,3962,2546,3003,3
103,3472,3144,3509,3663,4107,3267,3696,3757,4190
,3865,43
02,4366,4821,2683,3123,3220,3668,3366,3680,3841,
4220,3385,3824,3932,4341,4016,4427,4546,4994,343
6,3978,4
087,4469,4142,4566,4509,5051,4264,4656,4720,5221
,4854,5315,5432,5756,438,576,639,923,692,1021,107
7,1404,
729,1096,1135,1427,1187,1493,1512,1938,741,1184,
1221,1489,1258,1670,1703,2031,1357,1707,1780,213
4,1836,2
202,2261,2723,753,1246,1311,1687,1366,1773,1816,
2178,1407,1852,1890,2274,1944,2345,2400,2769,145
3,1919,1
978,2374,2049,2452,2502,2893,2080,2484,2573,2998
,2585,3055,3128,3786,969,1362,1393,1829,1435,189
3,1941,2
322,1533,1988,2019,2431,2088,2517,2564,2928,1597
,2028,2113,2493,2173,2579,2603,3026,2226,2606,26
33,3136,
2809,3198,3319,3822,1660,2170,2209,2627,2291,270
0,2717,3164,2353,2805,2861,3266,2964,3357,3408,3
938,242
9,2902,2995,3411,3086,3461,3587,4020,3218,3604,3
702,4115,3763,4210,4312,4805,988,1422,1497,1976,
1590,202
2,2098,2528,1639,2126,2182,2612,2241,2650,2671,3
151,1741,2215,2288,2674,2348,2789,2844,3249,2423
,2885,29
58,3383,3032,3441,3540,3944,1819,2319,2397,2856,
2505,2942,2932,3447,2549,3010,3049,3520,3169,359
3,3637,4
125,2643,3091,3206,3620,3254,3728,3768,4226,3333
,3814,3886,4345,4032,4441,4553,5001,1877,2440,25
14,3018,
2597,3071,3173,3609,2781,3211,3288,3746,3302,378
0,3853,4294,2819,3293,3327,3836,3452,3882,3996,4
420,356
2,4026,4081,4473,4166,4605,4679,5081,2888,3482,3
531,3950,3641,4044,4096,4525,3708,4156,4234,4652
,4321,47
29,4835,5256,3898,4246,4354,4754,4454,4871,4918,
5406,4533,4962,5041,5472,5156,5589,5737,6185,106
3,1537,1
615,2128,1730,2206,2277,2743,1764,2299,2368,2798
,2437,2870,2980,3545,1858,2405,2525,2921,2576,30
67,3036,
3573,2618,3108,3184,3691,3279,3734,3797,4270,205
6,2555,2624,3063,2778,3159,3227,3751,2795,3283,3
312,380
3,3362,3859,3916,4393,2822,3347,3427,3910,3556,3
990,4067,4482,3626,4136,4160,4612,4240,4688,4777
,5197,20
86,2772,2786,3259,2826,3298,3376,3877,2896,3457,
3525,3966,3598,4048,4150,4583,3201,3551,3646,407
5,3713,4
196,4250,4665,3871,4260,4360,4761,4460,4861,4909
,5392,3307,3723,3830,4202,3904,4333,4408,4795,40
10,4433,
4497,4899,4575,4972,5071,5515,4091,4538,4627,503
1,4715,5102,5189,5622,4812,5232,5301,5706,5367,5
854,589
1,6465,2108,2836,2864,3533,3156,3582,3631,4131,3
235,3685,3740,4216,3847,4288,4385,4786,3321,3791
,3892,43
08,3956,4412,4501,4890,4054,4561,4488,4945,4674,
5059,5145,5559,3567,3928,3984,4446,4121,4516,462
1,5011,4
186,4634,4706,5112,4768,5166,5266,5687,4327,4738
,4830,5210,4928,5329,5381,5814,4984,5457,5501,59
39,5604,
6001,6055,6349,3717,4004,4180,4643,4284,4697,474
5,5176,4374,4845,4880,5293,4955,5340,5486,5874,4
399,493
5,5019,5446,5132,5530,5542,6026,5245,5638,5671,6
077,5779,6220,6280,6711,4588,5094,5125,5574,5280
,5653,57
25,6132,5353,5795,5831,6248,5959,6312,6509,6843,
5418,5915,5980,6387,6102,6421,6551,6923,6159,660
2,6651,7
020,6773,7126,7280,7500,237,530,704,1100,817,114
9,1278,1652,902,1237,1350,1737,1446,1832,1865,24
02,978,1
318,1385,1812,1529,1916,2053,2446,1604,2041,1981
,2519,2188,2600,2656,3134,1044,1476,1583,1950,16
29,2024,
2110,2540,1758,2162,2212,2609,2351,2720,2766,323
7,1849,2236,2382,2749,2434,2825,2899,3310,2511,2
916,299
2,3450,3029,3511,3617,4129,1195,1504,1693,2149,1
777,2199,2339,2677,1884,2394,2247,2775,2478,2850
,2947,33
55,2009,2371,2499,2907,2561,2969,3024,3486,2639,
3045,3148,3569,3228,3654,3732,4276,2137,2531,262
1,3014,2
729,3088,3194,3633,2806,3203,3305,3698,3369,3805
,3884,4395,2929,3343,3470,3834,3500,3890,3992,44
92,3600,
4024,4103,4568,4178,4636,4752,5285,1415,1672,179
3,2362,1932,2426,2458,2939,2068,2490,2570,3006,2
647,308
3,3111,3628,2175,2582,2668,3096,2758,3189,3284,3
710,2841,3290,3348,3778,3480,3867,3970,4456,2271
,2703,28
15,3223,2858,3296,3388,3839,3001,3455,3506,3902,
3594,4018,4077,4564,3106,3553,3642,4046,3704,415

8,4188,4625,3811,4232,4337,4722,4416,4807,4977,5290,2316,2833,2961,3404,3075,3491,3589,4034,3139,3605,3665,4123,3738,4182,4272,4695,3271,3715,3784,4224,3896,4319,4403,4833,3948,4424,4507,4904,4592,5009,5069,5545,3380,3845,3918,4352,4052,4452,4520,4957,4174,4548,4632,5044,4726,5084,5224,5678,4268,4663,4756,5158,4798,5264,5326,5785,4969,5356,5423,5763,5492,5871,6008,6434,1558,1900,1966,2552,2083,2591,2684,3181,2095,2694,2784,3243,2875,3360,3413,3958,2258,2792,2881,3431,2979,3475,3542,3964,3037,3536,3622,4099,3721,4170,4204,4623,2294,2955,3052,3445,3161,3558,3648,4164,3215,3687,3744,4212,3799,4310,4370,4788,3210,3787,3855,4304,3942,4410,4465,4906,4063,4529,4594,5004,4659,5066,5171,5641,2414,3124,3168,3676,3262,3766,3851,4280,3315,3878,3912,4401,3998,4490,4544,4996,3611,3976,4059,4505,4134,4581,4654,5054,4242,4677,4772,5148,4847,5261,5334,5744,3761,4113,4218,4616,4300,4717,4782,5226,4387,4819,4873,5282,4982,5387,5449,5841,4514,4974,5014,5426,5056,5495,5403,5904,5192,5628,5681,6033,5703,6178,6252,6523,2469,3252,3276,3936,3563,4012,4073,4527,3681,4095,4138,4603,4238,4686,4765,5237,3749,4230,4296,4690,4349,4784,4856,5299,4429,4883,4950,5370,5046,5437,5539,5921,3952,4317,4368,4849,4462,4931,5024,5409,4601,5026,5074,5533,5195,5483,5659,6041,4710,5130,5250,5632,5307,5699,5753,6136,5389,5772,5769,6232,5908,6288,6345,6695,4109,4418,4535,5029,4683,5076,5163,5568,4775,5229,5272,5684,5351,5712,5766,6166,4859,5318,5412,5747,5452,5782,5911,6292,5565,5942,5991,6361,6088,6456,6514,6871,4999,5429,5521,5918,5656,5925,6066,6391,5675,6051,6144,6487,6208,6560,6656,6989,5715,6181,6272,6593,6324,6675,6626,7040,6425,6741,6794,7153,6894,7218,7296,7490,1717,1993,2121,2630,2223,2801,2889,3394,2282,2924,2984,3425,3068,3522,3547,4144,2305,3060,3119,3516,3176,3772,3816,4262,3324,3828,3930,4391,4006,4471,4542,5039,2328,3153,3257,3793,3334,3924,3982,4443,3399,4030,4083,4555,4152,4641,4704,5086,3464,4117,4200,4672,4286,4763,4809,5208,4325,4793,4885,5312,4897,5364,5435,6016,2712,3329,3374,4002,3438,4089,4148,4614,3578,4208,4248,4740,4335,4828,4878,5242,3670,4256,4362,4800,4437,4894,4916,5337,4499,4921,4947,5443,5127,5498,5610,6048,3755,4435,4480,4943,4577,5016,5036,5469,4647,5120,5179,5562,5277,5647,5690,6147,4733,5216,5309,5696,5395,5740,5847,6212,5518,5861,5945,6296,5994,6378,6469,6854,2741,3418,3527,4194,3659,4254,4343,4842,3727,4376,4448,4923,4518,4967,4987,5454,3873,4484,4572,4989,4645,5109,5161,5550,4731,5200,5274,5665,5345,5718,5805,6151,3986,4608,4699,5174,4816,5258,5248,5728,4866,5320,5359,5788,5475,5851,5888,6304,4960,5401,5509,5877,5553,5966,5998,6395,5625,6037,6106,6491,6228,6569,6665,7002,4069,4749,4823,5331,4911,5384,5477,5864,5099,5512,5583,5984,5598,6012,6073,6451,5135,5586,5616,6062,5731,6099,6197,6555,5824,6224,6264,6597,6341,6700,6762,7059,5205,5760,5798,6155,5894,6236,6284,6636,5949,6332,6400,6736,6473,6800,6883,7182,6114,6408,6496,6816,6583,6906,6941,7272,6641,6971,7033,7320,7105,7388,7480,7719,2867,3583,3693,4383,3861,4477,4557,5061,3906,4585,4668,5117,4742,5187,5296,5811,4040,4708,4838,5240,4892,5376,5348,5834,4933,5415,5489,5932,5577,5973,6023,6430,4292,4868,4938,5373,5097,5466,5527,5987,5114,5580,5607,6030,5650,6080,6128,6532,5140,5635,5709,6121,5821,6193,6256,6607,5881,6316,6337,6705,6404,6768,6832,7139,4329,5089,5104,5556,5143,5592,5662,6095,5213,5734,5792,6174,5857,6240,6328,6685,5506,5818,5898,6260,5952,6366,6412,6747,6091,6417,6500,6821,6588,6900,6935,7264,5601,5963,6059,6370,6117,6482,6541,6849,6205,6564,6617,6929,6680,6977,7052,7345,6276,6646,6721,7027,6789,7072,7132,7405,6860,7160,7211,7461,7249,7552,7573,7841,4358,5150,5182,5801,5463,5844,5884,6308,5536,5928,5977,6383,6069,6447,6528,6838,5613,6019,6110,6460,6162,6546,6621,6917,6244,6670,6612,6959,6757,7046,7098,7370,5828,6140,6189,6574,6300,6631,6716,7008,6357,6726,6784,7078,6827,7112,7189,7451,6478,6805,6877,7146,6947,7226,7256,7530,6983,7312,7336,7595,7396,7630,7654,7792,5956,6201,6353,6731,6443,6778,6810,7119,6518,6888,6912,7204,6965,7233,7328,7562,6537,6953,7014,7304,7092,7

353,7362,7642,7175,7414,7442,7667,7510,7733,7762
,7936,66
90,7065,7085,7379,7196,7424,7470,7692,7241,7520,
7541,7747,7607,7776,7858,7981,7288,7584,7618,780
8,7680,7
824,7876,8006,7706,7895,7915,8033,7957,8064,8098
,8138,12,53,93,234,128,256,350,537,158,333,384,584
,429,64
0,661,1038,185,367,399,629,472,701,795,1072,512,7
86,740,1119,879,1177,1220,1579,210,444,499,721,52
4,777,82
9,1132,596,863,896,1183,995,1262,1297,1664,650,91
1,1024,1285,1059,1342,1397,1722,1113,1408,1470,1
838,150
1,1891,1983,2406,276,458,561,855,607,887,987,1232
,671,1031,927,1303,1093,1364,1439,1761,768,1009,1
106,140
2,1145,1455,1496,1871,1208,1511,1594,1939,1659,2
010,2077,2541,846,1126,1196,1491,1274,1550,1631,
1994,133
1,1636,1718,2048,1774,2140,2200,2652,1423,1753,1
854,2158,1883,2204,2290,2742,1963,2314,2386,2816
,2451,28
79,2991,3530,415,549,618,1002,711,1052,1079,1429,
803,1099,1152,1486,1214,1545,1565,1990,871,1158,
1226,15
55,1291,1627,1704,2055,1359,1709,1757,2118,1863,
2186,2270,2711,942,1250,1337,1654,1370,1713,1787
,2161,14
75,1846,1887,2214,1959,2310,2363,2807,1560,1927,
1998,2334,2051,2432,2460,2871,2147,2501,2599,296
2,2670,3
043,3214,3532,973,1348,1450,1800,1536,1875,1955,
2327,1584,1967,2021,2403,2081,2457,2535,2933,169
5,2066,2
122,2492,2207,2581,2658,3072,2249,2679,2756,3137
,2835,3244,3306,3802,1783,2168,2228,2611,2340,27
02,2768,
3192,2447,2796,2873,3280,2965,3318,3460,3943,253
2,2906,2996,3393,3033,3505,3568,4064,3204,3601,3
671,403
9,3743,4167,4328,4836,485,681,730,1139,812,1164,1
238,1622,821,1244,1308,1668,1381,1766,1808,2263,
935,131
4,1386,1825,1460,1859,1915,2266,1506,1907,1986,2
380,2070,2444,2476,2868,958,1444,1516,1834,1603,
1931,200
2,2441,1650,2040,2085,2482,2132,2575,2629,3028,1
645,2125,2176,2566,2246,2667,2716,3145,2347,2779
,2840,32
41,2898,3299,3407,3905,1045,1574,1612,2029,1686,
2107,2172,2547,1731,2197,2225,2655,2293,2739,279
3,3231,1
975,2273,2344,2754,2409,2829,2895,3289,2510,2917
,3009,3384,3084,3501,3577,4017,2100,2393,2488,28
60,2563,
2957,3017,3467,2644,3056,3107,3523,3217,3634,369
9,4126,2762,3212,3251,3673,3292,3748,3651,4203,3
428,389
3,3949,4363,3973,4524,4611,4939,1086,1673,1700,2
242,1935,2307,2357,2776,2036,2373,2419,2849,2507
,2927,30
07,3474,2092,2498,2560,2930,2608,3022,3092,3544,
2682,3117,3187,3614,3285,3688,3796,4225,2259,257
8,2626,3
087,2714,3165,3258,3656,2843,3260,3308,3788,3435
,3735,3925,4373,2951,3368,3492,3895,3546,3968,40
29,4474,
3636,4053,4047,4589,4209,4653,4727,5157,2390,267
3,2782,3268,2922,3316,3403,3829,3012,3469,3510,3
955,359
7,3985,4045,4513,3094,3561,3660,4023,3701,4058,4
215,4660,3823,4249,4311,4746,4419,4860,4925,5380
,3234,36
79,3777,4221,3919,4231,4396,4776,3939,4379,4485,
4900,4567,4986,5106,5548,3987,4530,4637,5028,469
6,5126,5
070,5605,4822,5217,5279,5764,5411,5850,5954,6239
,573,758,838,1202,903,1320,1391,1792,950,1413,146
5,1821,
1531,1899,1920,2422,965,1521,1570,1895,1617,2111
,2150,2529,1735,2154,2239,2646,2304,2722,2788,32
77,980,1
598,1677,2129,1744,2232,2280,2696,1796,2324,2367
,2802,2428,2882,2944,3323,1850,2399,2470,2914,25
50,2999,
3048,3449,2584,3030,3122,3555,3135,3612,3684,434
0,1256,1740,1779,2297,1830,2370,2425,2857,1947,2
479,251
3,2978,2596,3064,3115,3483,2025,2526,2623,3041,2
690,3130,3152,3584,2751,3157,3185,3692,3365,3754
,3872,43
77,2096,2688,2731,3177,2821,3253,3270,3720,2892,
3358,3416,3821,3521,3911,3959,4491,2975,3458,355
2,3963,3
643,4011,4139,4573,3773,4155,4255,4667,4316,4766
,4872,5363,1280,1817,1903,2463,2013,2516,2605,30
77,2074,
2635,2699,3162,2765,3202,3222,3707,2193,2737,281
8,3226,2887,3344,3400,3804,2967,3439,3514,3935,3
588,399
3,4088,4496,2283,2854,2941,3412,3054,3499,3490,3
999,3100,3566,3606,4068,3726,4145,4189,4678,3195
,3647,37
62,4173,3810,4283,4322,4781,3887,4369,4442,4905,
4584,5000,5113,5557,2354,2989,3061,3575,3147,362
7,3729,4
161,3335,3769,3844,4301,3856,4334,4407,4851,3372
,3848,3881,4390,4003,4436,4547,4981,4112,4578,46
31,5033,
4721,5167,5239,5634,3444,4033,4080,4502,4191,459
5,4648,5085,4261,4709,4790,5212,4881,5289,5394,5
796,445
3,4803,4913,5314,5015,5428,5476,5931,5093,5519,5
596,5990,5705,6094,6223,6606,1375,1951,2044,2638
,2179,27 25,2804,3297,2221,2832,2909,3353,2983,3426,3537,
4094,2330,2949,3074,3478,3127,3623,3592,4124,317
0,3664,3
741,4243,3835,4289,4351,4827,2556,3105,3175,3621
,3332,3716,3781,4307,3351,3837,3868,4357,3917,44
13,4470,
4953,3377,3901,3979,4464,4106,4541,4617,5042,417
7,4691,4716,5172,4796,5249,5336,5743,2590,3328,3
342,381
5,3382,3854,3929,4430,3451,4009,4074,4519,4149,4
600,4703,5144,3756,4102,4197,4626,4265,4751,4808
,5225,44
25,4817,4919,5319,5020,5421,5467,5919,3862,4277,
4384,4757,4459,4891,4966,5354,4562,4991,5057,545
8,5136,5
528,5626,6028,4642,5098,5190,5587,5275,5655,5738
,6122,5371,5775,5839,6195,5896,6325,6356,6839,26
14,3391,
3419,4082,3712,4132,4183,4684,3790,4237,4295,477
1,4402,4846,4944,5346,3876,4346,4447,4865,4508,4
973,506
2,5447,4606,5121,5048,5502,5235,5614,5697,6067,4
118,4479,4536,5007,4673,5077,5180,5566,4741,5194
,5265,56
64,5328,5717,5807,6180,4886,5297,5388,5755,5484,
5862,5907,6289,5540,5978,6017,6396,6107,6452,649
5,6743,4
271,4556,4735,5203,4841,5257,5305,5726,4932,5404
,5438,5830,5510,5873,6002,6340,4958,5493,5575,59
67,5685,
6040,6053,6472,5787,6137,6164,6516,6258,6634,668
4,7039,5149,5646,5676,6079,5819,6149,6211,6561,5
885,627
4,6305,6659,6415,6713,6874,7148,5943,6376,6432,6
774,6536,6803,6909,7209,6585,6950,6992,7284,7088
,7371,74
88,7655,296,691,919,1418,1065,1480,1640,2089,117
1,1589,1726,2190,1842,2300,2337,2946,1268,1691,1
770,2276 ,1943,2396,2553,2994,2032,2538,2473,306
9,2705,3150,3207,3690,1353,1879,2006,2435,2059,2
523,2620,3089,221
1,2676,2734,3160,2890,3273,3320,3794,2317,2759,2
925,3304,2981,3379,3456,3864,3059,3471,3548,4001
,3586,40
60,4169,4682,1540,1911,2136,2661,2235,2719,2876,
3229,2360,2938,2773,3330,3025,3405,3503,3909,250
4,2911,3
046,3462,3110,3526,3581,4037,3190,3603,3703,4120
,3785,4207,4287,4832,2649,3079,3172,3572,3282,36
45,3752,
4187,3361,3760,3860,4251,3921,4359,4438,4956,348
5,3897,4019,4388,4051,4444,4545,5053,4153,4576,4
657,512
9,4732,5198,5311,5825,1804,2114,2256,2903,2415,2
973,3002,3494,2572,3038,3120,3564,3200,3640,3669
,4181,26
93,3132,3219,3653,3311,3745,3840,4263,3396,3846,
3903,4332,4031,4421,4523,5017,2799,3256,3370,377
9,3414,3
852,3941,4394,3557,4007,4055,4455,4147,4571,4629
,5124,3662,4104,4195,4598,4257,4712,4743,5186,43
65,4789,
4896,5283,4975,5366,5534,5827,2851,3389,3517,395
7,3632,4041,4141,4587,3697,4159,4217,4676,4291,4
737,483
1,5254,3827,4269,4338,4780,4449,4877,4964,5391,4
500,4983,5068,5461,5152,5563,5623,6056,3933,4400
,4472,49
10,4604,5012,5082,5513,4728,5110,5191,5599,5286,
5637,5767,6171,4824,5223,5317,5708,5357,5804,585
9,6263,5 525,5887,5946,6245,6007,633
8,6455,6815,1979,2377,2454,3 102,2587,3 142,323
9,3737,2602,3246,3 3 3 9,3798,343 3,
3913,3965,4511,2785,3346,3437,3981,3535,4025,409
0,4517,3595,4086,4175,4651,4275,4723,4760,5183,2
824,351
2,3608,3995,3718,4110,4201,4718,3771,4241,4297,4
767,4353,4869,4930,5349,3764,4342,4409,4863,4495
,4970,50
25,5464,4615,5090,5155,5560,5220,5620,5720,6139,
2959,3682,3724,4229,3819,4320,4405,4837,3870,443
2,4466,4
961,4550,5050,5105,5551,4163,4528,4609,5065,4687
,5141,5214,5608,4799,5238,5332,5700,5407,5802,58
68,6230,
4314,4666,4774,5178,4858,5276,5339,5770,4948,537
7,5431,5822,5537,5913,5969,6311,5073,5531,5569,5
948,561
1,6010,5929,6367,5739,6127,6173,6479,6192,6599,6
663,6886,3015,3806,3831,4489,4116,4565,4624,5087
,4235,46
46,4693,5164,4794,5246,5325,5778,4303,4785,4855,
5251,4908,5343,5414,5836,4990,5441,5508,5899,560
2,5961,6
049,6382,4506,4874,4927,5408,5023,5487,5578,5934
,5160,5581,5629,6043,5741,5999,6156,6485,5271,56
82,5793,
6131,5842,6190,6235,6563,5916,6254,6251,6644,636
9,6692,6739,7026,4662,4978,5096,5584,5243,5631,5
714,607
6,5335,5773,5810,6177,5882,6202,6249,6591,5417,5
853,5937,6233,5972,6261,6373,6696,6074,6399,6442
,6754,65
22,6830,6878,7166,5554,5951,6035,6380,6152,6386,
6506,6777,6168,6492,6571,6858,6627,6918,6997,726
3,6204,6
603,6677,6942,6720,7009,6972,7300,6807,7066,7106
,7392,7185,7439,7501,7646,2165,2485,2632,3180,27
45,3356,
3446,3947,2813,3481,3541,3977,3625,4072,4098,469
8,2838,3616,3675,4066,3733,4326,4371,4818,3879,4
382,448
3,4949,4560,5032,5101,5593,2862,3709,3813,4348,3
889,4478,4534,5003,3951,4582,4635,5116,4707,5201
,5263,56
40,4015,4671,4755,5231,4844,5322,5368,5752,4882,5350,5444,5848,5455,5893,5957,6462,3265,3885,392
7,4552,3
989,4640,4702,5175,4130,4762,4804,5300,4895,5386
,5434,5784,4223,4813,4922,5360,4998,5451,5473,58
70,5058,
5478,5505,5964,5679,6014,6112,6489,4309,4995,504
0,5499,5138,5572,5590,5986,5209,5673,5729,6071,5
816,614
3,6183,6575,5294,5761,5845,6186,5923,6226,6318,6
630,6031,6331,6402,6699,6445,6766,6842,7157,3294
,3971,40
76,4748,4211,4810,4903,5400,4281,4936,5008,5481,
5078,5522,5543,5975,4426,5045,5133,5546,5206,566
1,5711,6
058,5291,5746,5813,6161,5876,6207,6283,6577,4539
,5168,5260,5723,5374,5799,5790,6214,5424,5856,58
90,6267,
5993,6321,6354,6707,5516,5926,6022,6343,6061,642
2,6449,6781,6124,6483,6540,6862,6642,6926,7000,7
269,462
0,5308,5383,5865,5470,5910,5996,6334,5652,6025,6
089,6435,6101,6458,6512,6826,5688,6092,6119,6502
,6217,65
33,6616,6914,6299,6638,6673,6946,6735,7030,7079,
7316,5749,6242,6277,6581,6360,6648,6688,6980,640
6,6728,6
785,7061,6846,7110,7176,7410,6547,6792,6865,7124
,6934,7194,7224,7482,6984,7248,7294,7519,7354,75
74,7638,
7822,3423,4135,4245,4941,4415,5037,5118,5617,446
1,5146,5228,5670,5303,5735,5833,6286,4593,5268,5
397,578
1,5450,5905,5879,6309,5490,5940,6004,6393,6082,6
426,6468,6812,4850,5427,5496,5902,5649,5983,6038
,6439,56
67,6085,6109,6475,6146,6520,6557,6893,5691,6134,
6199,6553,6295,6613,6667,6955,6347,6717,6732,703
5,6788,7
083,7138,7381,4888,5643,5658,6064,5694,6097,6158
,6530,5758,6221,6270,6595,6327,6652,6724,7018,60
20,6293,
6363,6669,6409,6758,6796,7070,6526,6799,6869,712
9,6938,7190,7219,7475,6104,6419,6499,6761,6550,6
855,690
2,7152,6623,6922,6963,7214,7013,7253,7310,7539,6
681,6988,7048,7290,7101,7326,7375,7588,7162,7398
,7434,76
24,7463,7694,7711,7914,4917,5702,5732,6279,5981,
6315,6350,6710,6046,6389,6428,6770,6510,6823,689
0,7143,6
116,6466,6543,6835,6589,6905,6967,7205,6655,7005
,6958,7238,7075,7305,7348,7559,6302,6567,6609,69
30,6703,
6975,7043,7274,6750,7053,7096,7332,7134,7359,741
6,7616,6850,7115,7171,7386,7229,7445,7469,7677,7
259,751
4,7533,7728,7580,7754,7773,7878,6413,6620,6746,7
057,6819,7093,7120,7365,6881,7180,7199,7427,7244
,7452,75
26,7702,6897,7234,7279,7507,7342,7546,7553,7764,
7404,7594,7609,7782,7662,7833,7854,7987,7022,732
1,7337,7
567,7421,7602,7632,7802,7457,7670,7686,7844,7737
,7866,7928,8021,7494,7720,7745,7889,7793,7902,79
42,8040,
7812,7955,7971,8061,8003,8084,8111,8145,315,749,
1016,1608,1189,1682,1923,2412,1325,1867,2017,252
0,2143,2
641,2685,3363,1434,1971,2063,2617,2252,2771,2935
,3421,2350,2919,2846,3496,3097,3590,3649,4157,15
26,2183,
2320,2810,2383,2901,3004,3519,2544,3066,3125,359
9,3301,3714,3767,4273,2664,3155,3337,3750,3398,3
825,390
7,4350,3487,3923,4005,4498,4049,4563,4675,5154,1
748,2218,2466,3051,2569,3112,3287,3666,2708,3349
,3182,37
75,3453,3858,3961,4398,2884,3325,3476,3915,3539,
3983,4043,4537,3630,4062,4179,4622,4267,4711,478
7,5295,3
035,3508,3610,4035,3731,4114,4227,4689,3808,4233
,4344,4753,4417,4862,4929,5405,3945,4386,4521,48
79,4554,
4934,5027,5494,4655,5055,5131,5564,5199,5624,572
7,6213,2103,2438,2593,3313,2790,3386,3430,3953,2
954,346
5,3550,4027,3638,4108,4137,4685,3082,3559,3658,4
122,3758,4219,4324,4764,3850,4330,4392,4834,4532
,4912,50
05,5462,3209,3694,3817,4259,3866,4336,4434,4884,
4013,4510,4558,4946,4649,5052,5108,5558,4128,460
7,4694,5
075,4759,5181,5211,5615,4867,5252,5352,5701,5422
,5780,5938,6215,3263,3833,3975,4451,4092,4543,46
44,5067,
4165,4658,4719,5151,4792,5207,5287,5674,4313,477
3,4839,5244,4937,5333,5413,5806,4985,5433,5507,5
869,558
2,5965,6021,6431,4428,4893,4959,5365,5083,5456,5
520,5920,5196,5544,5618,5997,5704,6032,6154,6539
,5284,56
48,5733,6098,5771,6194,6246,6628,5930,6271,6329,
6610,6385,6697,6802,7108,2287,2728,2827,3528,297
0,3570,3
677,4213,2986,3686,3783,4279,3883,4404,4463,4997
,3197,3792,3891,4481,3991,4526,4597,5002,4057,45
86,4680,
5128,4778,5193,5227,5612,3236,3969,4070,4493,419
3,4613,4700,5188,4253,4744,4797,5233,4853,5327,5
382,576
5,4247,4843,4901,5321,4980,5419,5468,5875,5092,5
529,5588,5962,5642,6015,6111,6511,3375,4151,4199
,4730,42
99,4820,4898,5298,4361,4924,4954,5410,5030,5491,
5541,5955,4664,5010,5088,5503,5159,5576,5639,600
6,5262,5

660,5748,6090,5817,6188,6253,6594,4815,5139,5241
,5606,5316,5695,5757,6160,5396,5791,5840,6209,59
41,6298,
6351,6671,5514,5936,5971,6330,6009,6390,6313,672
2,6129,6501,6544,6824,6562,6925,6978,7165,3442,4
285,431
8,4976,4618,5047,5100,5526,4739,5119,5165,5594,5
259,5669,5745,6167,4806,5247,5313,5672,5361,5759
,5826,62
25,5436,5849,5914,6282,6003,6342,6427,6737,4993,
5330,5379,5820,5465,5895,5979,6317,5591,5982,602
4,6420,6
133,6379,6525,6831,5692,6075,6182,6503,6227,6558
,6601,6895,6301,6619,6615,6964,6725,7003,7045,72
83,5134,
5425,5532,5988,5663,6029,6105,6453,5751,6163,619
6,6548,6269,6570,6614,6919,5829,6238,6319,6598,6
352,662
4,6729,7006,6448,6751,6791,7056,6859,7122,7158,7
395,5958,6335,6411,6733,6521,6740,6845,7074,6535
,6834,69
01,7144,6951,7192,7257,7476,6572,6928,6993,7215,
7028,7267,7237,7502,7100,7314,7346,7575,7411,761
3,7659,7
775,2495,2865,3020,3619,3140,3800,3899,4440,3224
,3931,3997,4476,4084,4574,4602,5170,3248,4078,41
43,4569,
4205,4825,4870,5281,4367,4876,4971,5399,5043,547
4,5538,5995,3275,4185,4293,4848,4380,4963,5018,5
448,444
5,5063,5111,5552,5177,5627,5683,6036,4515,5147,5
219,5657,5302,5736,5786,6145,5338,5768,5855,6234
,5866,62
81,6339,6809,3705,4375,4423,5035,4487,5115,5173,
5603,4633,5230,5267,5716,5347,5800,5846,6175,472
5,5278,5
375,5777,5442,5860,5883,6257,5500,5886,5912,6346
,6072,6394,6486,6833,4811,5439,5482,5906,5570,59
74,5989,
6368,5636,6068,6118,6446,6206,6515,6552,6904,571
3,6153,6231,6554,6306,6590,6678,6954,6410,6689,6
755,701
1,6795,7068,7128,7387,3739,4468,4580,5215,4714,5
270,5358,5812,4783,5390,5453,5892,5517,5927,5947
,6358,49
20,5488,5567,5950,5630,6054,6103,6433,5707,6138,
6200,6534,6262,6576,6645,6908,5022,5600,5680,611
3,5789,6
187,6179,6580,5832,6243,6275,6632,6372,6682,6712
,7017,5922,6310,6401,6701,6437,6772,6798,7077,64
97,6828,
6873,7147,6961,7200,7260,7479,5095,5724,5797,625
0,5878,6294,6375,6693,6047,6405,6463,6783,6474,6
806,685
2,7117,6081,6467,6493,6841,6584,6870,6939,7188,6
661,6957,6990,7217,7042,7287,7325,7515,6141,6605
,6639,69
11,6714,6968,6999,7245,6759,7036,7082,7311,7133,
7350,7402,7589,6880,7089,7151,7363,7207,7419,744
1,7649,7
250,7462,7497,7674,7547,7717,7769,7906,3874,4638
,4750,5393,4907,5479,5555,6013,4951,5579,5651,60
63,5722,
6126,6219,6649,5072,5689,5809,6169,5858,6290,626
5,6668,5897,6323,6384,6748,6457,6776,6817,7103,5
310,583
8,5903,6287,6045,6364,6416,6787,6060,6459,6481,6
820,6519,6856,6891,7173,6083,6507,6566,6887,6657
,6936,69
81,7222,6704,7024,7038,7291,7086,7330,7374,7565,
5344,6039,6052,6441,6087,6471,6529,6867,6148,658
7,6635,6
921,6686,6970,7032,7276,6397,6653,6718,6986,6763
,7060,7091,7318,6863,7097,7155,7366,7210,7415,74
37,7644,
6477,6769,6837,7063,6884,7140,7181,7383,6948,719
5,7230,7432,7271,7466,7511,7690,6996,7252,7299,7
493,734
3,7524,7561,7729,7391,7579,7608,7758,7634,7807,7
819,7977,5369,6096,6120,6640,6362,6674,6708,7021
,6423,67
44,6780,7071,6848,7114,7169,7378,6488,6813,6876,
7125,6915,7184,7232,7428,6974,7265,7225,7454,732
3,7505,7
543,7707,6664,6898,6932,7202,7015,7240,7295,7484
,7054,7302,7339,7528,7369,7551,7593,7752,7136,73
55,7400,
7570,7446,7619,7639,7795,7472,7669,7685,7834,772
3,7853,7869,7949,6765,6944,7050,7307,7111,7334,7
358,755
6,7163,7407,7423,7604,7458,7623,7679,7814,7177,7
449,7487,7664,7537,7696,7700,7861,7585,7735,7746
,7875,77
83,7916,7931,8031,7278,7521,7534,7712,7599,7740,
7765,7891,7628,7788,7800,7923,7840,7940,7988,805
7,7653,7
827,7847,7959,7883,7967,7997,8072,7899,8009,8019
,8088,8044,8105,8126,8152,1813,2748,3167,3937,34
09,4021,
4239,4801,3579,4171,4355,4915,4504,5038,5080,568
6,3722,4305,4411,5013,4628,5142,5306,5730,4734,5
292,522
2,5803,5459,5880,5933,6344,3842,4549,4705,5185,4
769,5273,5372,5823,4942,5430,5485,5889,5633,5992
,6034,64
24,5060,5511,5666,6018,5719,6086,6150,6480,5794,
6165,6229,6582,6259,6625,6698,7019,4100,4591,485
7,5416,4
968,5471,5621,5953,5103,5677,5523,6042,5762,6108
,6191,6513,5255,5654,5783,6157,5843,6210,6255,66
08,5917,
6273,6355,6666,6418,6723,6775,7107,5402,5815,590
0,6247,6000,6307,6392,6709,6070,6398,6476,6753,6
524,682
2,6872,7174,6176,6504,6596,6840,6618,6875,6937,7
228,6687,6956,7004,7268,7049,7303,7361,7601,4457,4829,49 88,5645,5162,5710,5742,6184,5324,5774,5852,6241,5924,6303,6326,6706,5445,5863,5944,6314,6027,6388,6461,6 760,6100,6464,6508,6804,6604,6861,6924,7208,5549,5976,6078,6414,6115,6470,6538,6844,6237,6586,6622,6882, 6683,6952,6987,7266,6322,6654,6715,6969,6756,7037,7055,7298,6825,7081,7142,7347,7186,7389,7468,7603,559 7,6093,6203,6549,6297,6611,6679,6962,6348,6691,6730,7016,6779,7051,7104,7333,6450,6764,6808,7076,6879,71 31,7179,7401,6910,7191,7236,7435,7281,7483,7509,7701,6531,6847,6892,7150,6973,7206,7243,7459,7047,7258,7 301,7498,7349,7516,7576,7749,7102,7317,7364,7548,7384,7592,7617,7785,7465,7629,7656,7778,7682,7813,7855, 7970,4669,5123,5204,5835,5341,5872,5960,6381,5355,5968,6050,6429,6130,6517,6556,6916,5535,6057,6135,656 8,6218,6600,6647,6920,6266,6643,6702,7001,6767,7044,7064,7297,5573,6198,6278,6578,6365,6658,6719,7041,64 07,6745,6782,7069,6818,7127,7161,7380,6403,6811,6853,7123,6907,7183,7213,7436,6979,7247,7282,7481,7315,7 508,7554,7736,5698,6336,6371,6738,6444,6797,6851,7109,6484,6868,6889,7178,6940,7227,7255,7477,6694,6927, 6976,7235,7023,7275,7313,7503,7087,7324,7372,7544,7408,7591,7621,7771,6793,7010,7073,7293,7121,7344,737 6,7577,7170,7394,7420,7600,7471,7641,7665,7803,7239,7467,7485,7657,7504,7683,7648,7823,7563,7731,7750,78 63,7757,7904,7924,7991,5754,6436,6454,6903,6662,6949,6985,7246,6742,6998,7025,7286,7084,7329,7368,7581,6 786,7080,7118,7331,7149,7377,7412,7606,7193,7425,7456,7635,7499,7661,7699,7829,6913,7130,7159,7409,7212, 7447,7489,7650,7285,7491,7512,7697,7564,7678,7742,7865,7341,7536,7587,7732,7610,7756,7774,7892,7643,778 1,7780,7919,7825,7933,7948,8028,7007,7187,7251,7492,7327,7513,7550,7710,7373,7578,7596,7751,7627,7760,77 79,7901,7413,7614,7651,7772,7666,7784,7826,7934,7709,7835,7850,7952,7879,7975,7989,8062,7478,7658,7693,7 828,7741,7830,7872,7960,7748,7868,7894,7983,7912,7999,8020,8083,7761,7905,7929,8007,7943,8024,8014,8091, 7968,8038,8048,8109,8067,8118,8128,8151,4889,5236,5385,5909,5497,6065,6142,6542,5561,6172,6222,6565,629 1,6633,6650,7029,5585,6285,6333,6629,6377,6801,6829,7099,6490,6836,6899,7172,6945,7216,7254,7496,5609,63 59,6440,6814,6498,6896,6931,7201,6545,6960,6991,7261,7034,7306,7338,7517,6592,7012,7062,7322,7113,7367,7 390,7569,7135,7382,7426,7612,7431,7633,7660,7857,5985,6494,6527,6943,6573,6994,7031,7292,6672,7067,7090, 7356,7141,7399,7422,7583,6734,7095,7156,7385,7198,7430,7440,7622,7231,7443,7455,7663,7535,7684,7725,786 7,6790,7197,7221,7453,7273,7486,7495,7673,7309,7532,7557,7708,7598,7738,7753,7896,7352,7572,7611,7755,76 45,7770,7805,7913,7691,7810,7836,7935,7851,7956,7978,8059,6011,6559,6637,7058,6727,7094,7145,7406,6771,7 164,7203,7444,7242,7464,7473,7668,6864,7223,7270,7474,7308,7527,7549,7703,7351,7566,7597,7744,7625,7763, 7791,7897,6933,7289,7335,7555,7393,7590,7586,7766,7417,7615,7631,7786,7675,7806,7818,7938,7460,7647,768 8,7815,7704,7843,7852,7961,7730,7864,7884,7984,7918,8001,8022,8085,6982,7360,7397,7620,7438,7640,7676,78 11,7523,7689,7715,7848,7721,7856,7874,7974,7538,7716,7727,7871,7767,7882,7909,7998,7798,7917,7927,8008,7 947,8029,8042,8094,7568,7777,7789,7898,7820,7920,7932,8016,7837,7945,7962,8037,7979,8049,8065,8113,7886, 7964,7985,8052,8004,8069,8075,8125,8017,8080,8090,8131,8102,8140,8150,8171,6123,6676,6749,7167,6857,722 0,7262,7506,6885,7277,7319,7531,7357,7560,7605,7794,6966,7340,7403,7582,7429,7637,7626,7801,7448,7652,76 81,7832,7713,7845,7860,7969,7116,7418,7450,7636,7522,7672,7695,7849,7529,7714,7724,7862,7739,7877,7890,7 993,7540,7734,7759,7888,7797,7908,7925,8010,7816,7941,7946,8030,7963,8043,8055,8107,7137,7518,7525,7705, 7542,7718,7743,7881,7571,7768,7787,7903,7809,7921,7944,8026,7687,7796,7821,7926,7838,7953,7965,8039,788 0,7966,7986,8053,8005,8068,8074,8124,7722,7842,7870,7954,7887,7982,7995,8058,7911,8000,8012,8073,8025,80 81,8093,8134,7930,8018,8034,8089,8047,8096,8106,8142,8060,8110,8117,8148,8122,8157,8159,8179,7154,7545,7 558,7790,7671,7804,7817,7939,7698,7831,7846,7958,7873,7973,7992,8056,7726,7859,7885,7976,7900,7996,8013, 8071,7922,8023,8011,8078,8041,8092,8101,8137,779

9,7893,7907,8002,7937,8015,8032,8086,7951,8035,8
046,809
7,8054,8103,8114,8147,7980,8050,8063,8108,8076,8
119,8123,8155,8082,8130,8133,8161,8141,8164,8166
,8176,78
39,7910,7950,8036,7972,8045,8051,8104,7990,8066,
8070,8116,8079,8120,8132,8158,7994,8077,8087,812
9,8100,8
135,8136,8165,8112,8143,8146,8167,8153,8172,8174
,8184,8027,8095,8099,8139,8115,8144,8149,8169,81
21,8154,
8156,8173,8162,8175,8180,8186,8127,8160,8163,817
7,8168,8178,8181,8187,8170,8182,8183,8188,8185,8
189,819 0,8191]

**Sequence group 3: Q3_16384**

[0,1,2,4,8,16,32,3,5,64,1024,2048,4096,8192,
9,6,17,10,18,128,12,33,65,20,256,34,24,36,7,129,66,5
12,1
1,40,68,130,19,13,48,14,72,257,1025,21,132,35,258,2
6,2049,513,80,37,25,22,4097,136,260,8193,264,38,51
4,96,67,
41,144,28,69,42,516,49,1026,74,272,160,520,288,528
,192,544,70,44,131,81,2050,50,73,15,320,133,52,102
8,23,134 ,384,76,4098,137,82,56,27,97,39,259,84,138
,145,8194,261,1032,29,43,2052,98,515,88,140,30,146
,71,262,265,161,
576,45,1040,100,640,51,148,46,75,4100,266,273,517,
2056,104,162,53,193,1056,152,77,164,768,268,274,5
18,8196,
54,83,57,521,1027,112,135,2064,78,289,194,85,276,4
104,522,58,168,1029,139,99,86,60,280,89,290,529,20
80,524,
196,1088,141,101,147,176,142,530,321,31,8200,200,
1033,4112,90,545,292,2051,322,532,263,149,102,105
,1030,30
4,296,163,92,47,267,385,546,2053,324,1041,208,386,
4128,150,153,165,106,55,1034,8208,328,536,577,548
,2112,1
13,154,79,269,1042,108,578,224,166,519,552,195,40
99,1152,270,3072,641,523,275,580,291,59,1036,169,
560,114,
277,156,8224,2057,87,197,1057,116,170,4101,61,531
,525,642,281,1089,278,526,2054,177,293,388,91,104
4,584,76
9,198,172,120,4160,201,2065,336,8195,1280,62,282,
143,103,178,294,1058,93,644,2058,202,592,323,1048
,392,512
0,297,770,107,180,151,1060,2066,209,284,648,94,81
97,204,298,1031,400,608,352,2176,6144,325,533,115
3,155,21
0,305,547,300,1090,109,2060,184,534,537,115,167,1
536,4105,225,8256,326,306,772,2081,157,1035,656,3
29,110,1
17,212,1064,171,2113,776,4102,330,226,549,1092,53
8,387,308,216,2068,1154,9216,416,271,279,158,337,
1043,41
13,550,672,2304,118,332,579,1037,540,389,173,121,
1072,2082,553,199,784,4106,10240,179,1038,228,33
8,312,20
72,704,390,1096,174,554,581,393,1281,4114,283,208
4,122,448,353,1045,561,203,63,12288,340,2055,1156
,394,52
7,582,4224,556,181,1059,2177,295,285,232,124,1282
,205,182,643,2114,4108,562,1050,8201,286,585,299,
1537,35
4,211,2560,401,185,1104,396,344,4129,586,645,2059
,1061,593,535,240,206,1049,8198,95,2088,327,564,4
161,104
6,800,402,356,307,2116,1160,301,417,213,568,1284,
832,4116,2178,588,8209,186,1288,646,404,227,896,2
067,106
2,594,418,4352,302,1538,649,771,2061,360,539,1120
,111,331,8202,214,1091,2096,4130,309,188,449,1065
,217,40
8,2062,609,596,1168,551,650,4120,229,1052,2120,82
10,159,420,310,1093,541,773,2305,610,4132,1066,65
7,333,1
19,1540,3073,600,339,218,1073,8320,368,652,4103,2
30,2069,1098,391,313,450,1296,542,2180,334,233,42
25,1184 ,555,774,175,8204,2083,1544,123,658,612,1
312,2306,4162,341,777,220,1552,314,424,2074,395,1
216,673,583,822
5,4608,355,1568,2561,287,183,234,1094,125,557,212
8,4107,660,1068,616,342,316,2085,8257,1155,241,77
8,1105,
563,4136,345,2073,452,1074,397,403,207,2070,1097,
674,4164,8212,558,1039,785,432,2184,357,1344,187,
236,664 ,4226,2308,1157,624,587,1076,780,2312,844
8,705,126,1047,4115,242,565,1158,2086,398,346,456
,1408,358,2562,
4109,405,1100,8226,303,569,244,2144,1161,595,189,
4144,1106,566,2115,676,361,1080,706,589,8216,208
9,1051,4
110,215,786,647,1121,2192,348,419,1063,406,4168,4
64,2076,680,8228,1283,801,362,1108,2117,590,4353,
409,116
2,570,2090,788,597,1169,572,219,8199,5121,2564,12
85,311,708,1053,598,2097,601,1067,4117,651,421,30
74,792,
1122,8321,802,611,1539,2122,4228,602,410,1112,23
1,688,2320,1164,653,248,4131,8258,1054,2208,369,1
90,364,1
170,654,2568,4354,659,1095,335,480,2336,1286,315,
8704,221,1289,4122,2576,370,613,1185,422,425,224
0,1600,6
145,451,614,8203,1069,2592,543,235,1124,412,4609,
2118,343,372,1664,775,317,2092,1075,8232,222,417
6,426,11
72,2179,453,237,1070,559,2129,4133,833,1099,804,8
260,712,2098,1290,834,661,4121,1297,2121,808,779,
1541,61
7,1128,2063,4118,8322,604,433,1186,720,2368,816,1
077,4232,836,347,2181,1217,897,243,8211,1176,210
0,4356,6

62,454,1101,318,3076,675,1188,618,4360,898,8205,2071,1792,781,376,2182,1292,4134,428,1298,665,2432,736,1542,567,8240,840,4610,2124,1078,625,238,1107,2185,359,4192,457,1081,399,8206,2130,787,1545,591,1136,4163,2104,678,434,1159,2075,677,349,4137,8264,1102,245,2145,458,1313,666,1218,4240,2087,620,363,1109,2307,8449,127,191,4124,1300,782,2132,1546,407,436,1082,4165,2186,626,9217,571,1192,2193,465,1163,681,4138,246,2309,1123,707,350,8213,3080,4612,1110,599,1084,668,2077,790,1304,4145,460,2091,249,8324,1113,682,1314,2146,5122,573,411,1553,2563,803,789,1548,8227,4170,709,2136,1220,365,440,2188,1165,4368,628,1125,689,2078,8450,374,1171,4256,423,2194,466,1200,793,2119,1166,4616,250,8218,371,1554,2310,481,1345,574,4384,2313,413,1055,603,2209,10241,1224,4624,366,468,1114,2624,655,1569,900,4288,2093,805,8705,1316,615,3088,1346,4640,684,710,2148,1556,429,1287,8272,4166,2688,794,252,1173,373,2099,1126,4140,605,848,2196,8229,1129,690,1328,4227,2094,713,1320,632,2123,482,4177,8217,1187,806,2314,1116,427,904,6146,2321,1071,414,1291,2565,8214,223,663,4146,1409,2152,692,1570,835,2210,4169,1348,12289,619,472,2101,1232,455,4111,1410,2241,796,809,1174,8328,3104,4416,714,1177,721,2200,1189,837,4229,716,2125,8452,1130,864,1079,2212,4148,810,1352,606,2816,912,5124,8456,1560,722,2316,1601,696,1572,4119,2322,377,435,1137,8230,2566,817,4230,1178,319,2102,1103,621,1293,4480,2131,8706,812,484,1132,2105,430,4172,1602,838,2569,1248,8288,667,4233,3075,488,1190,239,2160,1543,4178,378,1576,8259,2183,459,1219,622,4152,2126,627,1294,437,2337,8233,4123,1665,380,2242,1547,818,1299,4193,2133,461,496,8336,1604,2324,4135,669,1315,2570,679,1083,724,4355,8220,2106,1193,841,629,2216,4180,1584,351,1138,3077,8261,467,1301,4234,2187,438,1180,737,2147,4241,1111,8234,251,1221,2134,462,4357,442,2108,1140,441,1194,8708,2328,5128,469,1085,2137,247,1555,4125,683,2338,8241,1549,842,1666,4139,2577,738,899,2572,1305,6148,9218,670,1302,2244,783,1550,3136,4194,849,1201,820,8266,2189,1317,4611,728,2149,1412,928,1115,4184,2195,8464,791,367,2224,1608,4236,901,1793,2190,630,8352,1222,4126,2578,685,1196,844,2369,4242,1144,633,8712,2079,1225,711,4167,1360,2248,253,1086,3081,8480,4358,691,1306,824,2138,1167,4361,902,2593,1127,8720,686,740,4257,2340,1202,850,2370,1318,4672,8384,375,2580,1117,444,1668,4141,2311,470,1226,8736,2197,483,5136,1616,415,2150,1347,485,4196,8262,2153,1416,905,3078,1321,4736,795,1794,2352,473,8236,4147,1131,2344,634,1204,2211,4244,744,1175,8323,852,2140,1233,4142,960,2095,1308,865,2315,8273,4171,1672,693,2433,1118,4362,797,1228,2594,10242,906,1322,4369,2372,715,1424,3089,807,4613,8242,1632,474,2256,1376,6152,636,2434,1349,8265,694,2198,4200,1557,254,2201,1179,717,4258,8207,2213,1234,575,1329,4149,2154,913,1571,2103,8512,798,4289,1324,3082,811,1133,5152,2376,379,8325,1208,2584,697,4248,1558,431,2625,607,8244,4173,489,2596,1561,866,2161,4260,1139,723,9220,2202,1191,4864,486,2127,1249,908,2317,8215,4364,1350,718,1330,3090,4370,813,1796,2156,8326,476,4614,1181,2626,856,1680,2272,4150,8576,839,1353,2214,725,4179,1134 ,2567,698,1141,8268,2600,4153,914,1236,2243,752,4617,1195,12290,3200,868,1800,5123,2318,819,1354,2689,8329,4208,814,1250,439,2571,1573,4231,929,8274,2323,1562,490,6160,2628,1411,623,2339,4174,8248,1332,671,2107,1240,4385,739,3084,1440,8219,916,2217,4290,1295,463,2608,1303,4181,8289,843,2162,1182,381,4372,2325,1361,497,8231,2204,4618,1574,930,2135,1696,4154,821,8451,2245,1142,726,4264,3105,1356,1603,2164,8276,5125 ,961,2218,1564,872,2109,4235,1413,8330,492,2579,1197,4195,631,2573,1145,8337,729,4182,2690,1577,700,2329,4156,1223,8453,443,3137,1808,4376,741,2326,1203,845,9224,4185,2574,1252,920,2225,4386,1362,382,8221,2341 ,1336,4625,822,2436,1728,2139,8235,6176,1414,851,3092,1198,4620,730,2632,10244,1578,498,4292,2817,1605,880,5184,2246,8290,1417,742,2220,4237,1307,445,2168,8707,1146,4197,2249,471,1472,2384,4243,1377,8280,635,3328,1585,4272,932,2110,1227,8332,687,4238,2330,1087,903,2191,4626,1364,8222,2151,825,4417,1418,2226,500 ,1551,8338,4127,2342,1606,846,3106,4296,1580,745,8263,2141,1205,5129,2692,826,1319,2250,8454,4186,732,1309,2640,4641,446,1256,8457,2371,1148,4388,3096,962,1229,2440,8353,6147,936,1206,2345,4418,475,1667,2818, 8768,853,4628,2155,1586,867,2228,4359,8237,1310,
1609,2199,637,4245,1323,3108,9232,907,4198,2257,
1378,487 ,2332,4201,8292,1235,695,2696,5126,1425,
2142,1209,8832,746,4400,2252,1420,828,2346,4392,
8243,1368,3079,7
53,4259,1610,2448,854,8340,1669,4188,2656,1617,2
400,857,4143,1559,8238,2373,504,4363,1264,2581,7
99,8267,
3201,4481,1230,1119,2203,4642,255,12292,1351,225
8,964,6149,2353,1588,909,8458,4420,2595,1824,719,
2348,51
37,1426,8465,3138,1380,4304,477,2157,1331,915,87
09,4482,2232,1325,2582,4246,638,1441,10248,2585,
1237,424
9,2163,748,1592,4261,8296,2215,944,1856,3584,420
2,869,2273,8354,1612,4151,1210,2374,491,5130,824
5,2354,1
670,699,2820,4424,1428,1251,8385,2205,4632,754,3
083,1920,858,4673,9248,2704,1618,2377,4644,478,1
442,8344 ,2158,6208,1326,968,2165,1673,4209,8269,
2260,383,1795,4250,3112,910,2219,8356,4175,1384,
1563,2824,815,43
65,8960,2378,1135,976,5138,2274,1355,2597,8460,4
204,1238,870,3140,1333,4674,8466,2586,917,1212,4
320,2435 ,1473,2356,8710,4262,727,1241,2264,493,4
615,8246,3202,1432,873,4648,2464,1633,2319,8275,
4291,1620,701,23
27,5248,1575,8249,2206,931,4366,1674,2385,1253,3
091,8713,7168,756,1183,2598,4737,860,9219,2720,1
444,4619 ,1334,2166,499,8304,4371,2380,1565,731,2
627,4676,1797,8327,3085,1634,4387,823,2588,1681,
10256,4155,2437,
922,1357,5132,2221,8270,1143,2169,4265,874,1624,
3120,8481,4656,918,2601,1363,4210,2247,1242,8386
,502,283
2,4373,1392,2227,933,8277,4252,1676,3086,1254,61
53,2276,8468,743,1415,4183,2386,1337,2360,12296,
4293,760 ,2752,1474,5153,881,8714,2438,1566,4212,
3144,1358,494,4266,8250,2222,1257,2602,4157,702,
2629,8360,1579,4
627,1798,2441,921,4621,9221,3329,1199,501,4738,2
331,1147,8331,2170,4377,1682,2496,876,5185,8291,
1636,240
1,1365,4374,3093,847,8278,1801,2609,4622,992,225
1,6150,8252,1244,2111,1338,4273,447,2388,8472,14
48,4389,
3204,1419,2442,4484,8281,733,1697,2575,4187,827,
2630,8482,1607,5140,2604,1379,934,4680,8721,2229
,1311,31
07,4865,1207,10272,2343,882,4294,1258,2333,937,8
716,4268,2280,1149,2172,4216,1581,8388,963,3330,
4297,168
4,2253,1640,9280,6161,2230,747,1366,4432,2691,83
33,505,2610,5376,1340,3098,1265,8293,4158,855,23
34,4378,
1802,8339,2633,1587,4239,2347,924,3585,8368,4199
,1369,734,2402,4274,1476,8334,2259,1421,4390,244
9,829,14
27,8722,5154,2233,1231,3152,4189,8513,965,2444,4
740,1698,2392,1582,8223,6154,938,2634,1809,4298,
2693,839
2,1456,3109,4688,884,1381,9225,2641,4419,506,258
3,5144,1211,12304,2288,1260,4488,2254,749,1688,8
282,4393 ,3097,1648,2143,4866,8737,945,2375,1611,
4203,2612,1804,8484,4276,966,3094,1729,4247,1024
3,2848,1150,2450 ,5156,755,2404,8514,1266,6162,85
9,2355,4305,8724,1589,3208,1422,4380,2349,940,84
55,2465,4744,1370,2261,4
190,8341,1480,830,2616,4300,1382,3332,8294,1429,
4394,2880,911,2636,8297,5127,1327,1593,4496,2234
,871,922
2,3336,4704,1268,2694,1619,8496,4448,2452,639,62
72,2275,1213,8488,1590,4421,2944,888,3110,8355,4
629,1700 ,2642,5249,1385,8284,2466,479,4251,2350,
1730,3586,8239,4306,1613,946,4401,2697,8459,1239
,2819,4643,750,2
408,8577,4396,1810,2587,1671,5186,3168,8738,969,
2159,4205,1372,1443,10245,6156,2379,508,2262,428
0,8516,1
430,3139,4630,1488,2357,9233,861,4633,2236,1704,
2497,4211,8400,1825,757,4263,3113,1386,8578,2265
,5632,16
14,2456,4321,12320,970,2657,1433,4422,2644,8342,
1594,3216,4402,919,2599,4868,8345,1812,1621,2698
,6177,15
96,8357,2277,4253,875,3100,1243,8298,5131,2207,1
335,4752,2468,8247,862,2358,4425,1732,3141,9226,
4206,162
2,2589,758,4213,8520,1625,2821,4308,1675,2658,87
28,948,5160,3114,1445,4267,2705,8769,1816,2381,6
209,977,
2167,8740,4872,1826,3588,1635,4426,10304,2648,92
3,4322,2387,1626,8305,2266,4645,1434,972,5188,83
46,3121,
1255,2416,4634,1712,8271,2700,4483,761,2278,1677
,8461,4404,3146,1272,4312,2439,9234,877,6164,236
1,1393,2
498,8300,5250,1214,3344,4512,1388,8770,2590,952,
4367,2382,1678,8416,4375,2281,1683,495,4254,8358
,3232,13
59,4433,2603,1504,8711,5139,2822,703,2223,4646,8
744,1339,3592,4768,1245,8387,2171,935,6400,2706,
1394,122
91,4214,2660,1637,4428,3360,9344,978,2389,4675,1
446,2825,8462,5133,1449,2268,1475,4636,11264,360
0,883,44
85,2362,1638,8833,4269,2472,1567,2443,4217,8715,
762,3264,5168,1259,2721,8467,6178,1436,2631,503,
8772,464
9,2403,1367,4295,3616,8483,1396,4880,2335,925,22
31,8251,4275,1799,2282,5134,1341,9228,3142,4324,
1246,217
3,8361,878,4434,2605,1450,4408,8752,2708,1477,61
68,3116,735,8306,2664,4800,1261,2390,4486,8469,1
583,2364 ,5192,1857,8348,3203,4270,993,2289,1828,
10249,4650,2826,1736,4677,3153,8279,885,4489,261

1,1858,8389,2393 ,5377,1685,2500,4379,9249,939,3122,6180,1832,2445,8308,4218,1803,2451,1641,8362,4544,2255,994,4449,3145,
12293,1628,5141,2722,1457,4657,8253,2606,980,3087,4299,8723,1744,2833,4159,1840,2480,8717,4436,1860,240
5,6151,926,8834,3392,5252,1371,2235,8473,1921,4490,2284,764,4623,9281,2712,1267,4678,3205,8470,1686,4652 ,2672,1478,2635,8718,4277,941,3124,5155,10246,1342,2828,6273,1699,2753,8369,4391,967,2174,4381,8485,1642 ,3095,4328,1922,2290,8580,1805,4220,2613,886,8283,5378,1400,1452,4301,3206,9236,831,4278,2446,1689,8776,
4739,2394,1760,6210,2504,8961,1591,3456,4658,947,8390,2406,5146,1864,2453,4382,8364,1649,3148,4681,507,8
312,2351,4395,1262,2617,5633,12352,1383,2292,4450,1481,8393,3209,889,4307,2643,1423,10257,6656,2237,181
1,4497,8528,3154,1615,4281,2614,9472,984,5200,2724,1702,4492,8254,2409,1458,4440,3128,8474,751,4682,2754 ,1701,8335,4741,2637,1373,3099,6155,8295,1269,2263,5157,942,8370,2834,4689,1482,2695,4631,8486,1690,3169 ,4336,1644,9250,2396,4302,996,2467,8285,5145,1387,3111,4191,8836,1151,2454,6184,1215,2512,10250,4423,971 ,2728,4660,8394,1806,3331,5142,1431,8784,2849,4896,890,2410,1460,8515,4498,3156,1650,4452,9240,2638,1595 ,4403,2457,8584,509,6212,3210,1489,13312,5256,2618,1705,4397,2836,8489,1270,4513,2645,949,8962,4309,3217 ,1731,4664,8299,2620,1374,5380,2267,8372,1623,4928,3333,973,8343,6274,2359,1692,4684,2756,9252,1814,4282 ,3101,1484,10258,5384,2646,1000,4742,8401,2649,1273,4500,3115,8476,1706,4323,2699,1597,8840,4992,2469,89
2,6163,2840,8286,1435,5158,3170,1827,8396,4690,2850,1813,4514,8490,2659,950,4398,3587,9223,1733,5634,265
0,1389,8592,4745,2458,1464,4867,8800,3160,863,6157,2279,8544,2736,4456,1652,4635,10368,3212,1713,5216,27
01,14336,1398,4207,2296,759,4427,8517,3102,
1447,4310,2417,8725,1490,5187,2238,1817 ,9345,6192,2412,1008,4
405,8347,3218,1274,4284,2702,8402,1395,4545,2707,1505,8497,5161,3143,510,4313,8739,2383,1598,4504,2528,8
492,3334,6158,1437,2363,9282,4705,1627,4692,2269,8301,979,5264,3337,1390,10252,4647,2418,1492,4746,8376,
2661,1679,4325,3233,8726,953,5148,2470,1924,8729,6216,2473,1829,4255,8307,3648,1639,4516,2499,8359,4406,
2662,763,5189,9728,3117,1708,4637,2591,12297,1734,4869,2283,1453,8417,6401,3172,974,4706,8518,2460,1818,
5162,2391,8498,1276,4753,2420,8964,4429,1397,3712,4215,10273,2823,1629,5636,2365,8349,954,7169,3
123,187
2,9227,4696,2270,1714,4435,8848,2474,4314,1737,3220,8521,5169,879,2501,4464,8302,1656,2285,4748,3118,830
9,1506,4326,2607,1830,8404,6165,2881,5194,9256,981,3147,4487,1451,8363,2852,4409,1928,2760,10305,4546,14
38,3338,5392,8968,2882,982,4638,2709,12294,6276,1247,3345,4430,8522,1687,2856,4329,8418,1716,2827,5280,1
859,8741,3589,4651,927,4870,9284,2665,3176,4271,1643,8730,2652,6179,1496,2481,8579,5640,1479,3234,8500,4
219,995,4754,2768,8408,1820,4708,2864,1833,10260,5408,3125,2884,6402,9346,1738,4437,2395,8608,1745,4873,
3265,765,8463,4316,2945,1861,5648,8471,2291,4410,3224,1740,8350,4520,2710,1888,8529,6170,2502,956,4491,9
235,3149,5312,1834,2366,12305,4769,1630,2723,8742,4679,3236,1936,4451,8864,2666,5664,1746,2946,10496,66
57,887,3840,4383,8310,1720,2829,4279,8524,1401,4330,2424,3340,8771,5190,1459,2476,4221,9229,1841,3346,46
53,8732,985,6224,2713,1343,8581,4756,2784,3590,5164,8365,1645,4712,2615,8313,1836,4438,2888,997,9264,441
2,3126,1508,10274,6181,2673,5251,2286,8745,1454,4337,3155,1862,8391,4874,2407,5201,8976,1691,2505,4659,9
86,12298,3129,4441,2447,6169,8371,1512,2835,4548,9230,1263,3593,5170,1402,8420,4493,2639,3184,8530,4499,
1483,2726,4303,8504,943,6166,2482,1646,10264,5193,3207,1651,8896,4770,2725,2397,4654,8582,1461,5135,315
0,9288,1404,4881,2293,4528,8366,891,2506,6280,8746,3361,1842,4453,2714,8773,5440,1485,3266,8585,4283,152
0,2668,4332,9473,1693,4760,2411,12306,3157,6404,998,2175,8475,5253,1703,4720,10276,2239,1748,4683,3348,8
314,2830,5172,1865,8640,4876,3594,766,6408,8545,2455,1653,4801,9237,2484,4222,3130,1375,8753,5143,2674,4
338,8395,1491,2619,4661,1462,8255,3240,5254,2513,8532,6182,511,3211,4494,10247,1761,4442,2729,9348,1275,
4552,2294,3171,8586,5504,1486,4454,8719,2755,1466,6658,2398,8774,4501,1465,3158,12416,5196,2647,988,874
8,4399,3132,4665,1493,8373,2716,4340,1271,9251,6240,2838,3352,5257,10369,1707,2508,4691,8487,1866,4285,2
297,3161,8477,5202,1001,4662,8424,2730,1762,6211,8316,3362,1923,4772,2621,9474,4457,2459,1694,8397,5176, 3601,4802,8374,1807,2851,4685,951,8835,6185,2837
,3596,10306,5147,1873,2757,4311,12300,1844,4882,
3268,87
54,2413,4743,1752,9242,5217,2488,1952,6288,8478,
3213,4444,1002,8777,2676,4515,3173,8491,5159,181
5,2737,4
502,9729,1391,4560,2422,8546,3219,6172,1925,8403
,2471,4776,1654,5379,10752,2514,1709,4897,8593,3
248,445
8,2841,8377,893,5204,3214,6213,9296,1868,2298,46
86,8588,2419,4505,1657,8536,3602,5258,1735,12321
,4666,25
29,3393,6186,8778,1277,4884,2622,8837,975,4693,2
461,10251,5265,1715,3103,4668,9253,2651,4315,184
8,8785,3
272,6660,1926,8727,5381,2414,2516,8432,4407,1710
,4804,3162,8398,894,5149,2703,9241,4694,3617,176
4,8287,6
193,2948,4697,10280,1874,2853,5163,8519,3364,474
7,1399,2663,8756,4517,1468,7170,12353,3394,2732,
4888,92
38,1494,5218,2758,8992,1009,4898,3604,4707,8594,
2477,1507,5635,8548,3335,6218,1439,8499,2842,469
8,2300,1
0308,4506,1509,3221,9352,5208,1929,4327,2421,849
3,3174,4784,1819,8609,6416,2653,955,8405,5260,28
96,4749,
8760,3177,4344,1497,9476,2738,5150,1658,9024,630
4,3376,2761,4465,12308,1768,4286,3368,10370,1876
,4460,2
680,8780,5266,2530,1984,8378,4750,3235,6664,9480
,1004,4755,2854,8838,3164,5191,1889,8596,4431,24
75,1717,
4576,8419,2952,6432,3119,9088,1821,5382,2462,102
59,4411,1930,3339,9254,4317,2271,5385,8786,1010,
6672,27
11,8610,1739,4466,3457,12544,4709,2740,1831,8494
,5281,3618,4518,9730,2883,4521,1498,3396,8841,63
36,1660,
5696,8963,2667,2520,4547,10253,1718,4710,3280,85
52,957,5165,2503,8731,6688,3458,4639,9312,1278,2
844,433
1,8303,1741,5220,2857,8523,3222,4508,1599,8406,6
214,2762,4439,9283,3225,1937,4468,10288,2769,576
0,1822,1
2322,3237,4871,2885,8501,4413,983,6188,8380,2764
,1835,5171,8641,3178,4318,2912,9257,4522,1403,31
27,8409,
5268,2858,6275,8600,1721,3400,4549,10254,1455,43
33,2654,8801,5166,2960,1631,8788,4655,3608,6225,
9360,15
13,2770,4929,3649,8743,5195,958,8842,4900,2744,3
620,12312,4808,1890,6194,8421,2425,5386,1747,924
4,2483,4
930,3185,10312,4757,1510,5393,8351,2865,3226,621
7,8612,1932,4904,2367,8502,4875,1742,3151,9285,5
637,266
9,4713,8733,987,3341,5224,8965,2860,6159,1837,10
497,4700,2532,1500,8802,4529,3180,5282,12324,247
8,4816,1
880,9258,3650,6464,2886,8849,4912,1863,5173,8525
,3296,1749,4932,8311,2715,4443,2536,9732,6277,10
12,3238,
11265,5313,2287,4993,8792,1722,4339,3591,8531,19
38,5272,8410,2426,6196,3624,9265,4758,1776,2507,
8560,45
50,3267,5197,8844,1892,4414,2670,12295,7172,1843
,2675,8422,4771,3342,5284,10261,1838,4714,2485,9
290,371
3,4994,999,8583,6167,2428,5888,8505,1463,3595,86
42,4877,2866,4472,9488,1953,6278,3347,8734,2509,
5388,151
4,10372,4524,2544,5394,8526,3652,4761,1647,8425,
2717,6528,1695,12417,4832,3363,9376,5638,2727,17
63,8747,
4663,3131,4936,8966,2772,6220,1016,8367,3241,517
4,2889,10275,4721,1940,4334,9736,2677,5203,1487,
8315,36
32,6281,8850,2399,4455,1867,8804,4553,3186,5177,
9504,2515,1405,4495,10498,3349,6226,2486,12354,4
883,152
1,8533,3228,5641,2785,8969,4687,767,5232,8412,31
59,6200,1954,9744,2299,4774,3269,8506,4530,1845,
8616,525
5,2510,6171,10266,2490,1750,4773,8587,3188,4445,
2489,9408,5198,1985,4341,8865,3242,1896,8775,624
1,2517,4
554,12800,3133,5409,1516,8547,4762,2295,3603,976
0,5314,1655,6183,10753,2731,4716,8479,3597,4459,
989,837
5,2890,5205,3714,8426,6403,1753,4223,9286,2786,4
287,8317,2947,1724,5396,8749,3353,4878,1467,1032
0,6228,2
718,5642,12299,3350,1765,8852,4503,2831,4532,926
0,3598,5178,1869,8808,6282,2897,8534,4722,3249,1
944,850
8,4667,2868,5288,10277,3365,6289,1003,9347,4561,
2776,8433,3460,5259,1406,8970,4777,2976,4342,929
7,3163,6
405,8755,1846,5219,2839,12328,1875,4803,2415,853
7,4446,3656,7176,10265,1754,5206,8644,2949,3841,
4695,92
66,1522,5180,2678,8589,4764,3270,8595,6173,1904,
4886,8399,2733,3244,5400,10262,990,4556,9289,289
2,6187,3
192,8866,4345,1766,5209,12356,2681,3273,8750,477
8,1469,5410,9231,2759,6242,3408,8977,4669,1495,8
624,450
7,2301,5649,10376,3134,1659,6659,8549,2739,4899,
9536,3354,4885,1956,8379,5644,2872,4805,8428,321
5,1711,8
856,6232,2950,5316,12418,3175,4461,10500,1927,45
36,2734,9349,6284,1005,5261,8816,2788,3250,8779,
4724,18
49,5221,9268,2898,4785,3366,8972,6174,1524,10504
,4470,2423,5267,8897,3165,1870,8318,4519,2492,62

90,9239,
3716,4562,1769,12307,5296,2518,8434,4889,3274,62
15,8757,1850,2531,9350,5262,3664,4346,10278,1756
,4467,2
463,8590,5650,3395,8538,6406,1470,4577,8648,2533
,3464,9600,5441,959,4670,8550,2953,6409,3369,107
54,4509,
1986,12301,5151,2843,4699,8597,3842,6305,9292,19
60,2521,5320,8495,3179,4462,8761,1499,4564,2682,
8436,52
10,3252,6720,10336,1877,4751,9353,2792,5665,3223
,8787,1891,4996,8381,2900,6189,3281,12336,4901,3
008,929
8,5412,1661,4711,8758,3356,7184,10307,2913,5442,
1931,8868,4780,3720,8553,2741,4806,1011,9272,624
4,3166,8
898,5652,2845,4525,8781,1511,5383,10281,3276,678
4,2954,9243,4890,1719,4348,12302,3370,5269,8407,
2763,17
70,4469,8978,3472,6195,8839,2855,5222,1852,9313,
4701,3680,10384,4944,2522,6292,8540,1777,5225,86
11,3424,
4786,2684,9255,5424,1878,8598,3397,6190,2742,123
60,4809,1881,8656,5416,3605,4728,10268,2302,6219
,8872,1
013,4578,9475,3227,5283,2765,8993,4902,1528,8554
,6410,3282,5212,9300,2623,3377,10309,4523,1823,5
000,878
2,2961,6417,12545,3619,5167,1279,8601,4510,2846,
9354,5387,3372,6661,8762,1988,4319,10282,2859,47
59,3181,
8980,5505,1933,8789,6248,2427,9361,4788,3256,174
3,8764,5666,2745,8411,4931,3606,6306,13313,1501,
5444,10
756,2479,4715,2655,9477,4568,2537,8503,6197,1939
,5328,8900,3609,4551,9245,2914,5506,8790,895,633
7,3187,1
0289,4892,2771,8793,4905,1662,3239,9259,5270,253
4,12309,7200,1772,8843,4810,3297,5273,8613,2956,
4817,11
266,1968,6296,3398,8984,5285,2766,9314,4933,3378
,4812,8994,1893,6221,8803,2861,5226,9731,3844,49
60,1515,
10314,5175,2524,12420,6308,3229,8794,4906,1723,5
448,8602,2904,4702,9304,3728,6912,1778,8423,5008
,2887,8
880,3401,5656,10512,1882,4818,2773,9356,6412,318
2,8845,5697,2746,4792,8440,1006,5668,12323,3189,
6418,92
46,2962,4473,1502,10400,4531,3284,8561,5233,2800
,8382,6662,1992,4913,8556,3243,5274,9362,2916,44
15,8846,
3848,6198,1407,10760,5199,2867,12546,4717,3402,8
851,5389,1934,6227,9287,2862,4908,8527,3298,4580
,8672,1
839,5228,2487,10528,6201,3621,9478,4526,2000,850
7,5698,2977,4934,8413,3610,6665,9481,2538,5344,1
2314,18
94,4763,3459,10768,7171,2671,8562,4584,1941,8805
,5286,3380,4335,9377,2719,6256,8614,1014,5639,86
17,3288,
4474,2787,10432,5672,3488,9792,6279,1751,14337,4
555,2964,5315,8643,3343,4718,8806,1517,6222,9261
,2511,4
723,10784,3351,5390,2891,8735,1897,4533,8427,643
3,3230,9316,5761,2429,4476,8604,1725,6338,12801,
3409,56
43,10310,2545,4914,8535,1955,5395,3622,8564,6229
,2978,9856,4557,3744,8967,4592,1780,5700,8509,28
69,6420,
10284,3190,4765,9267,1884,5411,8414,2774,6666,34
04,12368,4775,1523,8618,5179,3651,9364,4820,3009
,10371,
6202,3612,5289,8645,1755,4937,8429,2920,4725,926
2,3461,6312,8751,1017,5680,2540,10321,4447,3245,
12325,5
234,2679,9025,7173,1847,9291,4563,3193,5397,8996
,2777,6283,8904,1946,4534,10290,3625,5276,9482,2
748,483
3,3271,9026,6243,1898,8853,5207,2491,12313,4347,
3856,9489,5317,1942,10313,6230,2789,4558,9000,32
51,4538,
8971,2893,6204,9733,1526,5236,8809,3300,4537,932
0,2968,5290,1957,10255,6424,4565,12310,3410,5181
,8796,2
430,6233,8625,3384,4343,1767,9378,5651,2870,8912
,4779,3776,10560,6434,1784,9008,5645,3462,9269,4
938,289
9,12424,5762,3246,6673,9028,1905,4834,8539,2778,
4995,10373,3626,6668,9409,1018,5401,9089,2546,47
66,3653,
8435,5398,2928,9368,6340,1518,10292,4879,3465,12
548,2790,1726,8854,5646,3355,8646,7232,2493,4945
,9293,3
194,5297,8510,1945,4916,11268,2519,6285,8867,352
0,5413,9380,1525,4824,8810,3425,6245,2683,12552,
5508,36
33,9090,5024,1900,10263,5211,2980,9984,6291,3275
,8973,4887,2735,8568,4463,1871,10374,6320,3135,5
704,948
4,2951,4997,12326,2016,3412,8620,5889,2873,9490,
6286,3466,8857,4726,1471,10624,5318,2548,8928,66
74,3599,
4781,9734,1757,5292,8759,3654,4940,9032,2894,646
5,12802,3628,5240,10316,1851,4729,9270,2793,6175
,8817,3
253,5321,8430,2874,4807,991,9299,5456,3367,10377
,6344,2780,8551,4349,1958,12384,5182,3357,8649,7
177,249
4,9273,4787,3304,8591,5402,1906,10322,4920,3196,
8979,6234,3010,9737,5263,3277,4998,8783,1961,668
9,9328,2
984,5223,12355,3254,4782,10296,2523,4836,8870,19
87,6436,8626,3715,5298,9351,2901,4946,10267,1771
,6466,8
869,3634,5414,8541,2915,4471,12329,3358,6676,152

9,9294,5213,3657,8437,4540,2685,10337,5764,3371,8650,64
07,1879,9505,4566,2955,8858,5322,3426,9410,6293,2535,12432,4579,1948,10279,5712,3283,8812,4511,2743,855
5,6246,1758,9301,5443,3473,10499,4581,3257,8319,6249,2794,8383,5512,1853,12316,5001,3468,7174,9492,2876,
5417,8974,3416,4891,10324,1020,5890,9738,2801,6448,8599,3658,4569,8628,2902,5227,9274,1989,6440,12357,3
717,4730,10378,3665,5300,8818,1962,6307,8763,2905,4840,9384,3607,5271,10385,2552,4948,8657,1908,6236,93
55,3312,5329,8873,2847,5056,12330,3278,6191,8438,1530,5404,10501,3167,4961,9315,2303,6411,8899,3399,576
8,8542,1773,4789,11272,3012,6529,12804,3636,5214,9302,2957,4893,8791,1969,5324,9276,3872,6690,8860,2767,
5002,10269,3474,5418,8982,1990,6468,9496,3428,4811,12337,2525,5520,8652,3379,7185,10283,1779,4903,8441,
2963,5728,9305,3373,4570,8874,2686,6352,9506,5472,1883,10338,4732,3489,13314,6530,3285,8765,5445,2796,8
603,4790,1964,9745,6294,3640,10755,5653,2992,8995,4350,3904,8981,6297,1854,9740,5275,2917,12362,4813,36
60,8901,6309,3258,10328,5330,1935,9412,4671,2539,8557,5425,3718,8632,6250,2747,10380,5009,1007,9357,566
7,3476,12560,6199,4894,8820,3299,9317,5420,2802,8881,7178,1895,10270,4907,3968,8566,5229,2906,9363,6472,
3666,12448,4475,1663,8615,5304,2526,10386,6680,3490,8658,4793,3374,9392,5654,1912,8985,4527,3016,10311,
6721,3721,9358,4703,2431,12808,4585,6692,8442,1503,5657,8563,3843,4962,9746,2958,10502,6257,3432,8673,5
235,1970,9537,4819,3611,8766,6298,2863,12576,5287,3183,10505,4582,1774,8605,6223,3024,9247,5345,3403,87
95,5004,3286,10401,6413,5446,9416,1993,4814,12816,2918,5426,8558,3381,8660,7186,2965,9306,4909,1532,108
16,5892,3260,8847,6252,3521,9761,4572,2775,9092,5277,1885,12480,6722,3289,10285,4952,5776,8997,2541,636
8,9508,3480,8807,4935,1781,11280,5449,2921,9538,6310,3681,12832,4821,3668,8876,5230,1994,8902,6663,2749,
10340,4794,3623,9748,5237,6696,8621,2979,9479,5010,3722,12358,5332,1943,10880,6339,3301,8986,4848,2804,
8444,5291,3231,9365,7296,1015,8565,4964,2908,10291,5896,9318,3492,6414,12332,4915,3382,8797,5450,1899,9
040,6785,2547,10388,4910,3613,9321,5346,2779,8882,4535,9520,1886,6667,12419,3845,5669,10286,5025,3682,8
905,6419,2871,9512,5658,3729,8824,4586,1782,10315,6724,8674,2970,5507,12369,3405,4719,9379,3191,6435,89
98,1972,5428,10506,4767,2922,9308,6203,8619,3672,5336,9096,2966,4835,14338,2001,7180,10513,3411,5536,92
63,3290,5012,8606,2550,9483,6313,5391,10757,1947,4559,8415,3440,6704,8855,2981,5399,12338,3724,4939,960
1,3302,10344,6258,1996,8884,5278,4477,9762,2791,6421,9027,3463,5457,10402,3385,4593,12361,1785,9540,630
0,2808,8811,5670,3522,8664,5026,6231,10293,2929,5792,9424,1901,8647,4917,3614,12303,6341,3406,9602,5238,
2542,10433,4822,3305,8988,7201,9001,5452,1976,9366,5699,2750,11296,6260,3627,12608,5057,3846,8906,6314,
9369,1519,5660,8913,2969,4968,10392,6205,3247,9381,5509,2549,9029,4588,12421,3195,6675,8908,1727,5293,1
0317,3730,4727,9322,6669,2924,9056,5241,9271,3684,4825,10404,1959,6786,12340,3413,5673,9002,2895,9544,4
796,3849,8798,6425,5319,11008,3040,4539,9104,2002,13316,7233,3292,9752,5904,3386,8914,4837,2495,10508,6
422,5299,9793,1019,8888,4941,3496,9764,6670,3467,12311,5348,2781,10514,5016,8569,6321,3745,8627,5458,19
07,9329,4478,2875,10758,6437,9009,3655,5432,12422,3427,4918,9370,6532,1786,8511,5824,10294,2982,6235,92
95,3359,5510,8813,3255,4947,9485,2930,12672,7188,5294,10323,1527,4826,9004,3306,6728,8676,2985,9324,567
4,3197,10297,4594,6913,8622,1949,5701,12364,3629,9794,4976,3011,9030,6342,3732,10761,5513,3688,9440,483
8,8859,6316,1902,12425,5403,2795,11267,4541,8680,3414,6264,9382,2553,5242,8431,6345,3388,10352,4567,973
5,1759,5568,12370,3313,6480,8570,2903,9768,5473,4731,10375,3850,7424,8651,2017,5681,9411,3635,8814,5028,
2972,12344,6206,5323,10318,3417,8819,4783,2782,9486,6426,1909,8629,5183,3524,10529,4999,12315,6287,3469 ,9857,5460,2877,8572,6247,10434,3475,4921,9739,1963,5514,9010,6322,9491,3279,4596,12385,3013,5647,10325,
3746,6438,8653,2018,8688,5702,4942,9796,3630,7202,10516,2986,12327,5676,3857,8861,4841,3504,9507,6237,1
0762,5301,2004,8871,6788,2932,9275,4922,8916,342

9,5415,12547,6346,2554,10298,4828,9385,3259,5405,9033,1950,6736,8821,3308,10408,4542,5352,12372,2797,6467,9776,3736,8543,5244,3696,9330,7192,5058,11269,1788,5325,8659,2993,9493,6536,3659,12426,5032,10379,3852,5302,8630,6441,3014,9372,4571,8929,1965,5763,10339,3777,6914,12433,4949,9303,3198,6251,8443,2803,5682,9413,3314,10326,4963,1991,8654,6324,5406,12549,2907,8634,5705,3637,10300,6295,3470,9332,4733,8633,5419,2988,9386,7204,1021,10520,5003,13320,3418,6353,8661,5474,3528,9277,4583,10329,2878,6428,8439,1910,9747,5331,4791,12317,3430,6792,8875,3477,10530,5521,2959,9741,6238,3375,9034,5305,9858,4842,1855,12331,6348,3641,10769,5516,8930,2919,4924,9091,6442,10764,3316,5464,9497,3667,7175,14340,1971,8862,4849,5706,9494,2687,10436,6544,3261,8975,4950,3638,9742,5765,11328,6752,2936,12386,5713,1531,9041,6496,9393,3748,4953,9012,5655,10381,3433,6469,9509,2527,4600,12803,3778,8920,5360,6677,10341,1913,9604,4895,3661,9120,7297,2994,9307,5326,12376,5215,3287,10387,6299,8983,2798,4351,8559,5447,3858,10416,6354,9800,2008,5060,12428,3719,9093,6449,5684,9985,3017,5005,10382,3420,8822,6691,3491,9414,5920,12318,4815,1775,10770,6444,2556,8877,5522,9388,3478,7234,9036,5476,10561,3536,4573,12434,2909,6253,9336,5427,8825,1966,5011,10271,3752,9417,6328,3873,8903,5421,12359,6678,2805,9552,4734,3434,10440,5537,8445,2020,6681,9278,5333,11273,3662,6259,12550,3018,8883,4844,5688,9498,3481,6311,9016,3642,10330,5040,1995,9359,5952,12553,7680,2967,9094,4965,10785,3860,6369,9319,3669,5708,8878,5306,8932,3644,6470,12449,2923,10532,4587,6450,9394,1914,9042,5766,3291,10562,4795,9510,3383,6916,12864,5524,8567,2910,5347,10772,3780,6301,9309,4850,8636,1533,7179,9860,3670,12333,6016,2806,10503,4954,8662,6800,3673,9418,5714,10389,3723,6473,8675,4574,13328,1973,5538,9808,2996,6254,8607,5422,10342,3493,5064,9539,3864,8677,6261,3025,12388,5769,10345,6356,3874,9608,4479,9097,1997,5891,11270,7208,9513,3683,5006,12928,2971 ,8987,6315,3674,9986,5480,10544,5659,3482,8665,6920,2024,12339,4911,9323,6474,3020,10536,5231,8826,3303,5072,9396,6370,10403,3760,5451,12436,2809,8936,6693,5334,9367,1916,9044,4966,3725,10332,7236,9425,3320,5429,12334,6682,9152,2925,5013,10287,3441,9500,5308,6531,9057,3262,10507,5569,1974,12363,6452,9864,4823 ,3436,8885,5337,10625,3000,6360,9310,4589,12554,3726,7298,8989,3731,9420,5528,4969,10786,1887,9098,6560,2543,9514,5729,12561,3407,6415,10564,5716,8907,3552,4797,9616,2751,11281,6423,5671,8999,3387,12805,6302 ,1783,9824,5027,8666,5770,3293,10448,6481,9568,2983,5349,14344,7187,8828,3442,4852,10626,3685,9541,5279,6694,8886,3026,10390,4956,1022,12392,6816,9749,5540,3494,8446,5430,10393,3497,9371,6262,4595,8909,3523,12450,6476,2931,10405,5661,9426,4827,2032,8767,6723,9521,3686,5893,12341,7181,10346,3615,5730,9105,2810 ,9763,4919,6684,10295,3307,8990,5777,3484,12481,6533,9516,5018,1534,11274,5453,9003,2551,9325,6317,5239,13344,3415,10568,6265,3444,8571,4970,9400,5720,2973,10776,7216,8889,3847,5014,12440,6697,9750,2003,5459 ,8623,3389,10817,6343,8799,5338,3294,12365,4598,8681,2926,6928,10788,5488,9753,3498,6323,9058,3525,10353,5029,5772,12452,1977,9331,7182,8915,2783,5350,10394,6372,9383,3309,4839,13056,3631,8678,5511,6482,10319,3905,9441,5433,1787,9100,6456,10509,4856,12556,3041,6848,9542,5570,8910,3876,4977,9522,3784,11282,6534,5662,12562,2933,9005,7240,9988,3906,5454,10348,4590,8668,1998,6318,12806,3733,9373,5353,6698,10818,2987,9048,4798,9872,3880,6725,10464,5675,12342,3851,5894,9031,6537,9545,3689,10406,5017,1978,8917,7425,12371,5295,3042,9326,4597,10759,3676,6427,8890,5243,9333,3505,10792,6266,3028,12345,5778,9106,6592,3792,9428,4972,10435,1903,8944,5732,6497,12809,3888,9387,5461,7189,11392,3908,9060,4943,9992,2974,5897,13315 ,6705,10510,3419,5088,9011,3969,9546,6347,10881,5340,2005,12400,6207,9006,5434,2812,9442,4543,8631,3315,10763,6484,5544,9765,3734,12423,7300,3526,9121,5515,10515,6538,9754,2989,4829,8682,5793,14352,2006,6671 ,10820,3390,9603,4923,8815,6726,3747,10531,5703,12366,3015,9524,6700,5475,8863,3690,10299,5030,6325,9432,3970,12577,5407,8931,1951,7203,11276,5303,9632,3853,6439,9108,2934,10409,4978,12482,5354,3448,9487,6429,8655,5033,10800,3500,6376,9495,2879,12373,5245,6268,9035,3737,10354,5677,9374,2019,5059,8573,7426,12564,3808,10517,5780,6349,9553,3639,8689,5736,103

96,2995,6326,12810,4843,9766,3912,5462,9122,6787,10327,3697,9888,4601,1789,12346,6706,9013,5436,10437,2555,7194,9334,5361,8918,3310,12456,4951,3431,11297,6430 ,9548,5898,9795,3529,6729,10356,5683,13317,2937,6443,9153,1980,10410,5020,9756,7681,3471,9064,5465,10301,4830,12427,3859,6498,9605,3663,8684,5572,10771,6355,3032,9389,5517,12387,6545,8823,3750,4925,10765,3506,9337,5523,8921,6329,1911,12374,5327,10882,7248,9769,2799,5061,8892,3749,10521,6540,12348,5794,3421,9415,6488,8635,5678,11329,3317,5034,10000,2990,12568,6730,8933,5905,2009,10518,6789,9395,5552,9037,3530,7205,12377,3738,10766,4980,9444,5477,3692,9112,6737,10417,4602,12578,3044,6679,9554,3435,8574,5307,10533,6384,3199,9528,5356,12817,6350,9014,2021,4845,10628,3263,9920,5784,10331,7193,14368,3019,5744,9606,6239,9043,3854,11284,5041,6471,9390,3479,12812,5707,8922,2938,6708,10824,5900,9770,2010,8690,5062,7190,12484,3508,11009,5825,9797,3698,6944,9072,5246,13376,3643,10438,6546,9609,4851,2557,8934,6500,10412,5362,12429,3537,4955,9499,3753,8637,6451,10360,5685,1967,9338,7304,12389,5518,10441,3318,8663,6445,5036,9664 ,2997,10576,6561,12435,3779,5466,9569,6357,8827,3422,11520,5576,9777,4926,3671,12464,6712,9124,5478,10302,3021,7428,9419,1915,8879,5525,12430,6976,3740,10522,5007,9279,6732,9095,3862,10383,5423,5689,12818,3532,9556,6330,10343,3048,9017,4967,7432,12609,3321,9610,5364,10418,6790,3754,8692,5715,9743,6548,12319,2022,10534,4735,3645,9798,6371,9038,5309,11298,2940,5686,12488,7040,9772,3483,8937,4984,10333,7206,3875 ,9397,5796,13321,6738,10884,3861,9018,5481,1790,9511,6562,10442,4575,12378,2998,8924,6446,5826,9501,3781,10832,7682,12833,5709,3437,8638,5042,9448,3512,10563,6793,9340,5335,2911,12580,6915,11288,4846,9154,3700,9421,6504,5906,10632,1535,14339,6683,9128,5767,9398,3761,7264,10537,3446,12610,5065,8667,6255,9859,2807,5468,11010,5539,9045,3495,12820,6475,10347,4604,3538,9778,6358,9059,5526,10420,3865,12551,7235,5584,9502,3056,9801,6453,10391,1023,8829,4957,6332,12437,3322,9515,5800,11300,6593,9099,3443,5921,12390,4853,10449,3553,9570,7209,8679,5482,2558,10524,6361,12393,5710,9427,3646,8887,6552,10888,3485,5066,13318,6753,9617,2012,10334,5529,9401,6740,3675,8938,5690,12592,7312,10444,3027,9612,5015,6695,9020,3438,10538 ,5908,12584,5717,9560,3540,11271,6794,3727,8945,5692,12451,6373,9802,3001,10640,4971,7196,9046,2025,9861,5339,12380,6303,10848,3972,9809,5431,6564,10592,3877,9049,4958,12335,6454,9751,3687,5828,10565,7237,8696,2811,12555,5718,9456,6685,10773,3756,4854,8991,3782,11393,5721,12673,6917,9422,1975,9311,5771,6754,10395,3501,12834,5044,8447,7210,9543,3022,5541,10450,6801,9156,3866,14341,5912,10545,6477,9780,3324,5073,9101,6263,12612,3445,10787,5922,10016,7684,8911,3677,5731,10540,6744,13329,3002,9618,5019,11330,6483,9572,2026,5722,12496,3920,8669,6362,10349,5530,9523,3762,9107,5068,7217,12674,3785,10424,5351,9517,6512 ,10774,2927,12438,5808,8830,6796,3704,9633,4857,10777,6374,9429,3554,12441,5773,10355,7242,1917,8940,5368,9784,6535,12453,3878,10407,4973,9136,6457,3029,10048,5489,11776,6594,12394,3499,9061,5310,10465,7440 ,9804,3976,5484,12343,6686,9402,3486,10566,5048,8683,6478,13322,3030,5774,10546,6377,9862,3295,8891,5779,11012,1999,12616,4591,9620,7328,3735,9443,5455,10397,6699,12824,3764,8946,5600,11275,6918,10112,3907,4799,9050,6319,12865,2975,10896,5435,9810,7688,10569,3691,12836,5341,6267,8670,3544,9634,5031,10350,6802,14400,3527,9518,5490,9160,6756,1918,10357,5733,9865,7456,12401,3043,10452,5074,8575,6485,9987,3868,5542,12442,6921,11304,3881,9102,5545,10411,6364,12367,3786,9576,5571,9755,7696,3793,11016,4979,9007,6458,12557,2813,10570,5734,9327,6568,9168,3909,5663,13330,6539,10466,2033,9547,4858,10789,7360,12396,3788,9430,5355,9062,6817,3936,11332,5532,9525,6727,12866,3004,10778,4599,9109,6499,9404,3882,12512,5463,7712,10627,3678,9665,5492,10548,6431,12454,3984,8919,5021,9433,6327,10456,3794,5895,8685,6378,12807,1979,11394,5437,9624,7238,9065,2935,12840,5342,10656,6269,3768,9825,4974,10511,6701,12483,3449,9812,5546,8893,6804,10519,5573,13440,3507,9767,7212,4831,10398,3889,9123,6760,12558,5357,9866,3033,10577,6486,9445,5679,11283,3391,15360,6460,5953,8948,2028,9375,7299,10790,5089,12929,3693,9052,6385,10912,5924,9636,3884,128 11,6922,5832,9526,3045,10358,7249,8691,4981,12563,3556,10572,6707,9757,5954,8923,3502,10819,6489,12868,
5781,3910,9989,6596,11277,5035,9826,3739,12579,7218,9015,5928,10780,2034,9873,6541,12347,5899,10629,303
4,6547,9114,5737,9549,6351,13324,3560,10413,5090,9335,7241,10361,3311,12457,5724,9066,6818,9816,3450,55
53,11312,6702,12848,3531,9110,5076,10793,7183,9555,2991,12402,5840,10439,6929,9434,3694,8694,5936,11024 ,6576,1981,12565,5956,9584,6501,10419,3699,9125,5022,12444,7488,9868,3509,11278,5467,9446,6331,14345,60
17,10468,3452,6380,8935,4860,9607,2939,12375,6808,10578,5363,9529,3890,10552,7301,12485,5782,8952,3533,
10944,6768,9666,5574,13345,3568,9073,6731,5037,10630,3741,9758,7220,12404,5438,11336,2007,9550,6924,868
6,5795,12458,6849,10414,3046,9449,5063,10794,6270,12349,3751,8894,5738,7191,10821,3796,9771,6018,12819,
6386,9990,3913,10633,5901,9113,6709,12813,2814,11521,4982,9391,5496,8693,3701,12930,5548,10523,7302,933
9,4927,3423,10362,6542,12569,5785,9874,3539,10688,6490,9068,5856,13377,1982,9828,6600,10593,5687,9557,3
510,12566,7552,11285,5043,9039,2559,9993,6502,10801,5960,6549,12814,3809,9184,5745,10443,7244,14342,332
3,9436,4603,10303,6447,9530,3534,12465,5358,8639,6713,10580,3514,9640,5479,12581,6388,11396,3513,9611,5
577,10634,7305,12676,4985,8925,2011,6739,9889,5519,10767,3036,12379,6333,9019,5907,10822,3541,9799,7250 ,13332,5711,10796,3319,9571,6710,9126,5080,12872,3755,10421,6820,9503,5798,11299,6505,13057,3914,9399,5
554,10535,7224,9074,3049,12486,4847,9450,6850,3810,10525,5797,9129,6733,12460,3971,10472,5469,9341,7195 ,10364,5365,12408,3742,9773,6359,9155,5038,11522,2036,12489,6930,9876,5578,10445,3855,9832,6791,14353,5
786,10422,2999,8939,7265,9558,5740,12624,6492,10883,3921,8697,5092,10802,6563,13568,3892,9532,5483,1129
0,7207,9457,3800,5247,12350,6550,9047,5311,10526,4000,12570,6608,9994,5067,10825,3050,9779,6824,12431,5
902,10539,3863,9116,7427,11777,5527,12391,2023,9561,6945,8926,4986,10594,6506,12466,3439,9668,5556,1045
1,7252,9613,3973,12582,5746,10641,6734,9021,3702,9619,5691,13346,6553,10425,4605,9423,3757,11344,7306,1
2381,5585,9157,2941,10636,6714,12932,5801,9890,3916,10584,6932,9774,5366,14346,6741,9130,3705,10826,504
5,10001,7313,12490,3783,10885,5827,9648,6716,11301,2040,12880,5470,9076,6363,9573,5719,10833,3325,12611 ,7429,8698,5069,10775,3023,13336,6455,9403,5788,10480,3763,9452,6852,12680,5910,10446,7197,8941,3896,98
80,5580,12585,6742,11289,3974,9840,5096,10335,6745,13058,5369,9137,3758,7211,10567,9803,5802,12395,2942 ,10804,6795,9996,5693,12468,3812,9158,6565,11286,4988,9921,6936,12439,3922,11040,5531,9342,7266,10642,1
791,13348,5923,8947,6946,10596,3447,9458,5909,14354,6755,9051,5046,10547,3516,12497,7683,9781,5829,1140
0,3542,9614,6746,12572,5485,10541,6554,9132,3057,10657,5560,12936,7256,9562,3555,10453,4959,12382,6375,
9672,3487,9022,6832,10808,5748,12492,7308,9574,3557,11524,5809,9621,6797,12586,3977,11072,5494,9103,639
2,10828,4855,13319,3867,9519,7198,9785,5543,12688,2013,10426,6513,9063,5586,11528,6334,12896,3003,9460,
5913,10886,6508,9811,3545,12640,5104,10644,7314,8831,3706,14464,5370,10467,6798,9405,5491,9782,3816,126
13,6803,11136,5601,9080,3924,11302,12821,7239,9892,4606,10834,6479,13441,4032,9577,5694,10658,6624,8671 ,3052,12443,7430,10542,5533,9922,6459,11778,3937,12498,5723,9805,6365,9138,3765,12593,5075,10889,7433,9
431,5486,11011,2027,12835,6514,8942,5588,10600,3869,12588,6757,10002,5775,10779,7329,9863,3978,13378,50
49,11360,9161,6566,10351,3058,12397,6020,9564,6569,9635,5925,14348,3787,10571,7744,8700,5735,10454,3879 ,12472,6595,9622,6758,11331,4859,12822,3546,9680,7213,10549,5804,9053,3708,12825,6687,10428,5830,9896,6
379,10689,3766,12403,10017,5549,8949,7268,12455,3005,11305,5070,9578,6556,10457,5914,13824,2014,9806,64
87,10648,5372,12513,3326,9162,6516,10849,5493,9625,7808,12614,3789,10836,6919,9786,5725,11408,6461,3647 ,5050,12594,7219,9111,3985,10791,5968,13060,6366,10004,5810,9813,3870,10890,6570,14369,5833,9788,3031,1
0469,7316,12445,4975,9067,6597,11292,3883,9435,5752,13323,6381,10399,3451,7214,9527,5602,12944,6703,106
60,3769,9054,5926,10550,6977,12617,5077,9924,3503,11333,7243,12398,5547,9814,2029,10781,6948,8950,6024,
12405,6856,9817,3679,11013,5534,12500,7434,9867,3561,10850,6978,9140,5078,13352,6805,3006,11306,5343,96
37,7441,12459,5783,10897,3938,10008,6952,10573,5

812,14401,3795,9169,6923,10359,5955,13064,7685,10018,35
58,11780,5023,9827,6761,12618,3980,10840,7272,9115,5739,12514,6748,10579,3790,9818,5592,10458,6577,1283
7,5575,9626,3035,9164,7330,13380,5091,11313,3885,9447,6864,5916,10608,6960,12826,1983,9904,5929,10892,7
221,12675,6980,8953,3548,10470,5834,9869,6491,12596,3928,11338,5841,9464,7361,12504,4861,10631,3911,906
9,7041,14356,5957,10553,6387,9585,3797,10690,7320,13442,5836,9406,3060,11536,6806,12704,5984,9580,6598,
10782,3770,9144,5052,12559,7245,10574,5930,9870,3986,12567,6462,10473,5726,9875,6819,8687,3824,12446,73
32,11424,6032,9551,3940,12625,6762,10795,5842,9696,7042,13331,3891,11014,4983,8895,7936,10415,5816,1283
8,2035,9531,6925,11784,5497,12960,3886,9437,6520,10363,7436,9127,5555,14592,3047,10898,6572,9586,5937,1
2406,7442,10852,3511,9829,5081,12620,6809,11552,5439,9170,4001,10581,6880,12867,7686,9638,5741,11017,35
62,13325,6711,9641,5932,10460,3695,9667,6984,12828,5093,11792,7222,9075,3743,12677,5604,10554,6769,9830 ,6382,12461,3811,10664,5550,9759,7251,10635,5958,12409,3064,8954,6503,11456,5787,13360,3988,9451,6601,1
0913,5082,14370,7225,9628,3535,10823,6543,8695,5608,12841,6931,10595,2037,9559,5359,12487,7689,11808,54
98,9588,3915,13072,6735,10527,7280,9117,5579,10423,3453,12467,6822,9991,5039,10474,3569,13326,6578,9533 ,5742,11334,7303,12516,2815,9438,5747,10365,6821,9070,6493,12626,4002,10797,5557,9642,7246,12600,5500,1
0900,3893,9669,6389,14360,4987,11308,6602,8927,3798,10856,7457,12992,5938,9453,6810,10582,4033,12678,55
81,9775,7362,10556,5616,13384,3944,10049,6764,11395,5789,12462,3564,9185,6507,10481,10020,7253,12842,50
94,11018,3703,9928,6271,12869,5799,11345,6335,9077,1919,12681,5844,10803,7444,10050,6926,10585,3037,135
69,5961,9877,7690,10692,4862,12571,3801,9131,6551,11314,5749,14372,6580,10024,3772,10637,7226,12410,547
1,9995,6770,10643,3515,9833,5587,12736,6715,10447,5558,9186,12641,3813,11337,7336,9820,6609,13333,4607,
10914,3917,9649,7307,12849,5857,10798,6825,9172,3992,11279,5371,12491,6390,9936,7267,11025,3051,12351,5
582,10032,6851,10672,5562,12628,3454,10052,6494,
10597,5561,14343,7254,9118,11584,3894,13444,6743,9563,5
084,10427,7228,10113,3923,12682,5589,10476,6812,8956,5367,12815,3802,10904,6934,9459,7448,12870,5803,11
397,2030,9878,6604,12844,5962,10864,6393,9670,10827,3570,12469,7257,9133,5097,11316,6826,13347,3952,953
4,5858,11020,7458,14465,6019,9891,3038,10945,6717,12583,6555,9159,5790,10366,3814,12573,7697,9834,5903,
11287,12520,6947,10114,3517,10482,5047,9997,6933,12412,7692,10805,3543,9078,5969,13570,6853,9592,5940,9
644,3707,12493,7364,11398,6509,9023,5848,12470,10638,4004,9881,6584,12931,6048,10586,7309,9952,3759,144
02,5098,10696,6772,9783,7269,11648,3975,12850,5911,9139,6833,10598,5487,13338,10056,3053,10645,6518,125
74,7315,9841,6021,11340,3897,12873,6567,8699,5750,10543,6610,12587,2038,9454,5805,10809,7344,13825,6937 ,9575,10484,3572,12642,4989,9673,7310,11401,5964,9081,3918,12499,6394,10835,6515,9615,5753,14848,3817,1
0429,7698,10003,12689,5831,11346,6625,9807,7489,12473,3898,10806,5373,9176,6718,13392,5071,10916,3804,9
894,6557,12684,5811,10601,9650,7199,12632,3518,11320,6747,8943,5944,12874,7368,10946,3007,9893,6022,129
33,6510,10829,6612,9565,11291,4034,14347,5806,9461,7258,10455,4990,13349,4008,9134,6799,11026,7713,1288
1,5860,9674,3547,10887,12823,7044,9882,5970,11361,6949,12528,7460,9836,3925,10588,5495,12494,6759,9188,
5564,10659,3939,13337,9579,7490,11303,6828,12383,5590,9343,2041,10646,6854,14376,5105,9407,7700,10704,3
709,12615,9163,6573,10920,5603,12852,7431,9998,5535,11523,3979,13334,6938,9623,6396,11041,5605,13088,90
82,3059,10602,7317,9652,6025,12690,6517,11348,3559,9842,7270,12644,5915,10830,9787,6749,12595,3767,1064
9,5051,8701,6992,14404,7273,11402,5593,9681,3818,13448,6834,10810,9897,5754,12589,7472,11028,3900,9462,
6857,12705,5864,10837,7464,9141,3825,12501,11409,5972,9923,6776,12856,6626,10812,3926,9566,6080,13572,7
331,10459,5100,9815,13120,6950,11525,3929,9165,7260,14466,5985,10551,6571,9884,3061,12876,5813,10948,10
006,7048,12474,7215,11293,3576,9676,5917,13576,6558,10838,6026,9192,12934,7435,10841,3871,9465,6367,126 92,5106,11307,6807,9898,3327,12515,5835,10891,97
89,7553,13184,6836,10661,2042,9084,5927,14355,77
14,1103
2,6979,9627,13350,5594,11362,4036,10019,7492,128
82,5756,11042,6763,10005,3981,12706,10851,6616,9
142,581
4,12590,7376,11779,3791,9925,5053,13826,6599,108
42,9581,7554,12937,5374,10650,3549,9656,6940,130
59,5837 ,11352,6953,9055,14349,3987,10471,7318,1
0928,5695,12648,6858,9844,7321,12827,2943,11404,
9905,6033,13408 ,6865,10893,5918,9590,3710,12399
,7333,10488,8951,6981,12619,5079,11294,3820,9639
,6860,12502,5931,10609,
7274,9682,13379,7008,10430,4016,10009,5499,1438
4,7223,10604,6954,9200,12597,3941,11410,5817,946
6,7496,1
2476,5551,10894,6750,9587,12737,3563,10899,7056,
9697,5727,13353,7704,11335,3771,8702,5609,12505,
10575,6
866,9790,7745,12696,5054,10720,3826,11526,6840,1
4350,9629,7716,10555,5986,12897,3930,9819,6521,1
2884,58
43,10461,9171,6579,13456,7281,11529,2015,9582,56
06,12839,6961,10610,9684,7322,12938,3054,10853,6
028,987
1,6463,12517,11425,5838,9145,7247,13340,3550,106
62,6765,10116,5083,14408,10665,7437,10021,4040,1
2447,69
56,11840,5933,9831,6628,12708,10691,5596,12598,3
455,10854,7276,8955,6574,13381,5976,11309,9900,7
746,128
29,3982,10783,6982,9926,5959,13061,10475,7392,96
45,3887,14593,5845,11364,6811,9166,6632,12898,10
652,510
8,10010,4048,13354,7334,10583,6383,9468,12945,58
18,10612,3942,12621,7687,9589,6034,11904,6522,12
407,110
15,7720,9821,3989,13828,5872,10557,6603,9146,153
61,7363,11315,5988,10064,3062,12888,6766,10462,9
906,593
9,12627,6771,10666,3799,12506,7438,9929,5934,114
12,13361,6581,9071,7809,10693,3565,12656,5095,98
48,1047
7,6524,12940,5559,11310,3945,9698,7691,12518,107
99,6962,10022,6049,14357,7443,11073,3773,13386,9
173,660
5,11339,5610,12679,6640,9643,7748,11044,12601,40
03,10120,5743,10952,6813,12738,5791,9630,11530,7
459,135
84,2044,11074,6823,9174,5859,12830,10901,7227,14
468,3828,9439,6868,11537,5112,12622,9879,7337,11
048,698
5,12521,3932,9908,6036,11019,13472,6773,10051,55
83,11781,7728,12843,3571,9119,13062,6495,10857,5
963,113
68,7282,12463,9835,3803,10844,6611,14371,5501,96
88,7445,10673,13832,6582,9671,3065,11426,5617,12
411,732
4,9187,12946,6881,10960,4863,10012,3895,12900,72
55,11056,10025,6050,13600,6395,11317,7365,11076,
14594,3
994,9930,5941,12629,6606,10587,6586,9937,13065,5
846,11457,3946,8957,7284,12508,11137,6585,10053,
6081,13
840,3990,10483,7338,12602,11416,5992,9932,6613,1
2712,7229,10902,10080,3574,14362,5612,10694,639
1,9148,7
699,12683,11341,5751,13504,4005,10026,6827,1055
8,12961,7693,9822,5085,10915,6986,12871,3815,114
28,1012
8,7810,12643,5849,10858,6882,13856,9938,7043,111
38,3832,14849,5820,9079,7449,12032,12575,5563,99
12,6814 ,11021,3953,12471,9593,7446,12522,5861,1
0616,6927,11532,13382,7694,9651,3066,10668,5965,
12413,6993,1003
3,11538,7345,12845,6040,9177,3566,14416,10905,69
64,9535,7461,12948,5099,10976,11782,2031,13356,6
872,983
7,7556,12904,10807,5502,10028,7072,12630,3774,11
080,9189,7259,12604,5942,11318,6935,9700,5971,14
373,108
65,3993,13443,6511,10478,7752,9646,12529,5850,11
347,7045,10054,3573,13066,10599,7937,13393,5618,
9883,67
74,10697,12851,7366,9178,3948,11321,6000,12633,1
0639,6829,14361,7340,9704,5086,11027,12740,3919,
9455,69
88,11785,7288,13362,9594,5862,12685,6777,10831,4
064,11376,12691,7369,9675,5565,10918,6855,12495,
9135,75
04,14358,3519,10674,5591,9838,13385,6397,11399,7
230,9843,5755,12962,10917,3805,10589,6835,12846,
7450,96
53,13327,6052,11342,6968,9596,3899,13073,10485,7
311,12720,5807,9083,7046,10698,14472,7271,11553,
6023,10
034,3039,12645,10906,6830,13632,5101,9677,11458,
6884,12475,7346,9712,4006,10860,12524,5945,9885,
6994,12
952,7462,10603,11349,5620,14596,3954,9190,6519,1
0367,13445,7261,9895,5966,12912,6588,10431,9940,
4009,12
875,7812,11540,11022,5865,13364,6614,10057,7370,
13068,11786,4035,8958,5946,14600,6627,10647,984
5,7760,1
2993,5852,10676,12414,3819,11322,6559,9567,7491,
13335,10866,5566,12530,6629,9683,3577,10811,128
53,7560,
9654,5055,11432,7049,13446,10705,7465,14374,608
2,8703,11403,3927,12686,6939,9953,7938,12634,109
21,6056,
9467,6617,12744,10486,2039,11363,7275,13696,559
5,9678,12646,6778,10947,7348,9658,3996,14850,105
90,5973,
12693,6888,9657,11350,7319,13388,5987,10839,380
6,9180,12591,6996,11324,7377,12857,9685,7104,109

08,5757,
12532,7452,9463,14432,3901,11030,7009,11544,134
49,6027,9899,7816,10700,6837,12883,10058,3068,12
477,510
7,10489,11353,7262,13394,6941,9193,5607,12854,10
922,4037,9954,7372,14403,11554,7050,10115,5815,1
2964,74
66,10813,12649,6859,10651,4010,9886,13368,5866,1
1793,7568,12994,6951,9999,11043,5948,12877,3956,
9143,14
377,7776,11029,6618,11788,13339,5873,10065,7520,
10949,3578,12503,10036,6780,13074,5974,11460,10
605,749
3,12935,6838,9944,5977,13409,10680,3821,10144,77
01,14480,11405,6398,12636,5109,9194,10868,7323,1
2707,40
17,11365,6861,13351,10007,5624,10929,7378,12694,
9583,6719,12752,4038,10614,11411,7473,14364,591
9,10117,
7057,10663,12968,7715,9846,5375,13571,10706,382
7,9901,6942,13089,11440,7468,12650,6084,11033,90
85,6955,
13396,3931,11406,7277,14405,10060,6029,10490,65
23,12878,10611,7352,12697,5839,9849,11794,4012,1
3450,68
41,9927,12858,7702,10721,5597,11585,6575,14378,9
469,3902,13076,6751,10814,9167,6633,12885,6035,1
0653,13
457,7705,9907,7010,11295,12860,3983,10843,4991,1
2507,10040,7283,11464,6867,14852,10118,5758,135
73,3055,
10606,7335,10708,12599,6630,9902,5868,12996,113
54,7393,9086,7052,13341,10895,3943,12886,6064,11
809,995
6,7494,14385,6862,11140,12889,7474,10066,3711,11
045,13355,5989,11556,6957,12939,9591,7940,10855,
5611,12
709,6620,9660,15362,3960,11586,7325,10924,13080,
5819,9686,7000,13410,10950,7824,9201,5874,13090,
11796,2
043,12899,6983,10669,9699,7497,13827,5978,11527,
14410,6869,9631,3551,11034,12890,7278,10492,684
2,12698,
9701,5102,11413,7285,13400,10121,7058,12519,401
8,10613,11366,5598,12976,7380,10011,14608,6896,1
0845,60
88,9147,13452,7339,11088,3822,12941,11369,7012,1
2536,7944,9689,10930,5503,13342,6963,9850,14496,
4041,11
568,7498,10953,12657,6030,9960,6958,12478,11560,
7394,10068,5935,12652,10872,3580,13458,6583,107
22,1017
6,7717,12942,6096,11427,14856,7073,9196,7706,129
47,11046,3933,11356,6634,13383,10081,5990,12623,
7555,10
667,9909,6767,12768,6037,11144,14624,3829,11311,
7476,10013,13574,6815,10654,12603,5110,10122,73
84,1153
1,12509,6883,10463,4042,13577,9202,7584,14864,58
47,10903,9931,7060,12658,7439,11649,12901,3991,1
0932,56
13,10023,13473,6607,11810,7447,12710,11075,6987,
12713,5993,9690,11588,3063,14528,9852,7326,1388
8,6525,1
0859,10712,5821,12739,7505,9910,12902,6641,1147
2,3947,9149,13357,6051,10695,7718,14880,11650,70
74,1283
1,7840,9470,11036,5876,12523,9933,3934,13412,696
5,11049,11414,7286,12700,5980,9791,14406,6870,10
954,750
0,12631,11417,3830,10129,5619,12660,10961,7747,1
3952,10014,7105,11429,7708,13063,11077,5851,126
05,4020,
9175,14380,7016,10956,7557,10027,13363,5113,113
70,6636,12510,11104,7341,12714,9595,4049,11319,6
775,134
60,11050,5943,14467,7289,9913,11592,6873,12741,6
042,9647,12525,3995,10846,13358,7721,11152,6844,
9823,12
847,7367,11800,5994,14417,9705,6587,10962,4044,1
3121,11841,7952,13387,9150,6038,13092,6885,1093
6,11812,
7347,13000,6989,10082,14386,3833,10617,13578,56
22,9939,7396,10675,13122,7064,11377,6053,12949,9
702,750
6,13585,11057,3949,11418,6526,14409,10124,7480,1
3096,5863,10559,13067,6966,9934,11343,7872,1382
9,4024,1
0861,12905,5880,9179,7558,11533,13416,6995,1105
2,14351,7342,10029,6001,12892,10724,3567,9692,68
74,1272
1,11372,7722,13474,10670,5114,13008,6642,10072,1
1842,7749,14656,2045,11078,13104,7024,10055,133
65,5614,
11488,7561,9941,13124,6886,10907,12635,5822,107
28,7451,14469,9204,3775,11430,6589,13505,10479,7
290,131
85,9914,6041,12531,6615,11783,10130,7616,13464,4
007,10618,14388,5621,11816,12950,7521,9968,6779,
10699,1
2742,7729,11459,13389,5996,10084,4050,12606,108
62,7076,15364,10035,7371,10867,6831,12963,11534,
5967,13
476,7231,10030,12906,3067,10677,11905,7047,1318
6,6112,9191,14359,7508,10620,14080,6969,9655,756
2,11787,
13069,5567,11058,12664,3955,10145,6644,14470,11
539,7695,10701,13580,5853,9706,7750,12716,10736,
6990,13
586,11844,3834,12953,7724,9839,10909,5947,14720,
9887,6889,13024,7349,11555,13830,6970,10919,995
5,5087,1
2855,3575,11323,13128,7463,10964,14412,6876,920
8,6054,11433,13366,7453,11081,12913,6590,10132,3
997,125
26,10869,7400,13395,9679,6002,11824,7292,14473,1

0591,7106,12647,10059,7373,12745,3950,11378,13369,6057, 10707,9597,7080,12687,7350,11541,14418,6619,10678,13075,6083,9713,7811,11420,13833,3807,10977,12879,6997,8959,5867,13424,11351,7730,14392,10146,7011,10491,7454,12966,11461,4065,12722,10037,5625,13447,10702,7753,14363,6781,10682,9942,7467,12965,11380,5975,12637,7051,10681,13390,3957,10177,12533,7522,11434,6631,10088,14433,6044,10709,12746,7379,11325,13601,6839,9708,4011,12954,10487,5854,11795,13506,7569,9847,7353,14375,10923,6890,12908,11789,5949,12651,9181,7564,11082,4066,13397,11906,6972,14595,9945,7512,12415,5116,10978,12479,6897,11139,9916,7754,13588,11545,6998,13070,4052,9659,14420,6085,10910,13834,7813, 11542,7761,9957,12695,6058,11023,12724,7001,11790,13370,3998,10061,7703,14474,11089,6648,12914,11441,6004,10136,12859,7408,11060,6943,13480,11557,7374,14481,9195,3836,12753,10968,5626,11652,7263,13451,9598,6399,12969,11168,7495,12534,11355,5869,14597,7108,10038,13411,4013,11031,10067,7732,12995,10607,7053, 12638,6065,11848,15368,7968,9946,13398,6863,11141,12033,7570,12887,4039,9714,13372,6086,10870,12956,7524,11462,14365,6621,10096,7475,13078,10925,5875,11436,13592,7059,9182,12748,3069,11084,14379,7469,11384,6782,12537,9958,5979,13401,10873,7585,11465,12970,7381,9661,3958,13602,10951,6892,14434,11600,6060,12861,9687,7736,12699,10493,7088,13841,8000,11326,9851,5950,14851,10931,3903,13091,11546,7013,13077,7756, 10148,13836,7354,11064,12997,6031,11407,9903,6635,14424,11142,7814,13508,4019,11367,12653,6843,10119,12728,5103,10926,14476,7572,9197,13453,7395,10980,6898,11442,12916,5991,10041,13413,3579,11090,12977,8064,11558,14366,7002,9716,7762,12662,10615,5759,13459,11357,6622,10062,12711,7586,10684,14482,3961,11908,7470,12754,9961,6008,13488,10710,7112,13081,11466,7817,14407,10042,6527,10723,13454,5599,11856,7939,12538,9948,2046,12659,10655,7054,13842,11587,7528,14598,9662,6066,12769,10725,7707,11656,6959,13633,9151,7279,12862,11145,4056,14601,11561,5870,12701,10178,7120,13343,11035,7499,12891,7382,12034,14497,6089, 10 152, 10713,7014,13512,11371,3823,12654,9691,7477,12756,10874, 7061,13402,5628,11444,14912,7356,10069,12943,7617,10984,13857,6871,11415,10083,4014,13188,11092,5981,14381,11473,7385,13093,6637,11200,13604,7576,9853,12903,5877,11548,15376,7017,11105,13634,4068,10123,12972,7777,11912,10933,7764,12998,6090,9203,14436,6845,11358,13844,7719,11037,12717,7075,9703,13575,7818,11468,14976,4043,11146,13082,6039,9911,12540,7397,11562,6900,13461,10955,7327,9962,12661,5111,11664,14387,7004,11047,13414,3962,10044,12893,7588,11872,13136,7478,10714,14484,5995,9969,13417,6643,11616,7709,12978,10876,6875,13616,10070,3581,11589,14382,5982,10934,13001,7941,10073,13608,7778,11797,12920,6967,10494,14411,7825,9205,12770,5878,11419, 13475,7066,10957,13094,4021,9720,7501,14602,11474,7287,13404,10815,6068,11569,12715,7018,10015,13192,7768,11153,14609,7062,11811,13359,4045,9471,12702,6097,11038,13579,7507,11564,14853,7386,10180,12511,6646,11051,12951,6043,11373,7536,13697,10125,7077,14440,10619,4072,12980,11448,7820,9935,13858,7398,10937, 13123,6092,11798,14498,6887,9693,13636,7559,10671,12907,7481,10847,12760,5881,10729,14389,3964,10131,13520,6904,11801,12743,7618,11106,13698,7025,9087,14529,5997,11379,13084,7710,10963,13097,7502,9854,4022,11431,13462,6638,10726,15392,7401,9964,13002,6072,11489,13465,6846,11148,13009,7723,10160,14488,7942, 11590,13477,5615,10958,13125,3935,11570,13004,7065,10085,14413,7343,11053,13418,6645,12036,13152,7291, 9707,13367,5823,10716,14500,7826,11421,13098,7020,9915,13640,3831,11096,12894,7780,11920,15104,6055,9970,13200,7509,11079,11593,6991,13848,10074,7945,13010,10965,7136,14604,11374,6098,13889,10938,3070,12984,9198,7388,13860,11381,7482,14610,11154,6591,12665,9694,5115,12723,11476,7592,13425,10992,7563,14854, 10184,6877,13105,11435,4080,13466,11108,7841,12607,12040,6003,14390,9599,6971,13391,11059,7751,12909,11594,7523,13581,10126,5882,14419,11054,7078,13100,11490,3582,12772,10031,7455,13420,10679,7351,14393,1 1813,7026,12718,10192,5623,13890,11169,7402,131
26,11802,7081,14857,10730,7293,13536,10086,4051,
12955,1
1651,6045,15363,10863,7725,12776,10133,7107,134
78,11572,7828,12527,10911,7784,14448,9206,5998,1
3831,11
480,6891,12666,10979,13864,4025,11680,14471,751
0,9943,12747,6649,11156,13507,7484,11535,12910,5
855,970
9,14414,7409,10703,12915,6999,11543,13582,7946,1
1083,10089,3835,12725,14625,6113,11422,13953,77
31,1062
1,12668,7068,9917,14530,7513,11601,13835,6878,10
737,13106,6005,10147,13587,7620,11814,14421,404
6,11170,
12749,11936,7565,12784,9972,6973,13892,11061,75
71,14612,11382,6059,12957,10076,7375,13603,1096
6,7109,1
4858,11596,7842,12967,9715,4026,13371,11843,611
4,13012,11201,7726,14394,11804,7082,13481,9947,1
3129,79
53,11112,12917,7600,11653,14504,6100,9209,13872,
7028,10732,12639,7525,11437,13426,3951,10871,15
365,665
0,10039,12755,7355,11385,13589,6046,10969,14475,
7404,10138,12726,11817,6893,13468,10940,7832,13
025,114
63,7792,14435,10090,4053,13399,10683,5884,12539,
12048,7089,13509,10134,7755,14422,10981,7948,12
750,114
43,12730,7110,11085,14396,6061,9718,13428,7873,1
1492,12729,7294,11160,13482,4054,10149,14616,68
99,1275
7,11602,7410,13373,10622,14425,6087,11576,12535,
7003,9959,13843,7733,11062,12971,7566,11968,146
26,7084,
9976,13837,3999,11654,13130,5117,11091,13954,11
438,7514,14865,10097,7624,13026,10970,6974,1318
7,11818,
6006,14860,9210,7526,13593,10738,7573,12958,118
45,13590,7055,11120,14532,4067,9710,13071,7471,1
1657,10
982,5951,9918,13838,7737,11547,15424,7015,10685,
13137,11386,7412,13489,10137,7763,13108,10711,6
067,144
77,11712,6783,13605,9717,3837,13016,11617,14437,
7357,10875,13700,7734,11825,13216,7032,10092,13
403,562
7,11172,14483,7844,11467,13079,10927,7529,12655,
10063,6623,14512,11327,4028,13896,11143,7874,13
189,102
08,6009,11604,14081,11065,7757,14478,11658,7090,
12918,9663,7383,13510,10740,6894,14866,11791,79
54,1297
3,9949,13484,6104,11846,13132,3959,11086,14657,7
815,11820,13432,7113,10043,12921,7516,10985,143
67,1144
5,7587,13513,11066,5871,12999,9183,6652,13648,11
559,7574,14536,10972,12541,7632,10150,13374,405
7,11549,
15369,7005,10686,12979,6062,11496,13594,10098,7
848,13112,11388,7969,14426,11202,6901,13455,114
69,7530,
13190,10153,14881,6116,11176,13415,7758,11446,1
2974,7114,10715,13028,4069,10179,14628,11907,75
77,13490 ,11093,7738,13138,9963,6091,14658,11826
,7063,13606,11107,12663,7956,11550,14868,7765,97
21,13405,7740,11
849,12732,10877,7019,13956,11563,2047,14599,100
71,6010,12758,11147,7387,13514,11618,14485,7479,
10727,1
2771,7006,10140,13904,7876,11475,12703,10935,56
29,14438,9950,7766,13635,11665,6902,12773,11449,
4058,14
441,10986,13704,7769,10045,13193,7819,11660,153
66,6069,11068,13609,11608,7092,13083,9212,7589,1
4082,10
993,7960,14640,11850,12761,7121,11094,13419,797
0,10181,14632,4015,11909,12922,11857,6093,13492,
10154,7
779,14499,11097,7067,13032,11799,13463,7770,107
44,13140,7578,10100,14428,6120,11504,13521,1103
9,7116,1
3248,11470,7399,14383,9722,7856,13596,11359,131
53,3963,10495,14603,6905,11591,13960,6012,9965,1
2981,11
204,7821,14721,11828,7416,13406,11149,7021,1308
5,10161,13516,7537,12064,14882,7358,10959,13194,
6070,11
666,13610,10182,4070,14660,11620,7532,13003,107
17,13712,7096,11571,15377,7822,9971,13095,7827,1
1155,13
920,11565,5983,12762,10878,6639,14544,13664,750
3,10075,12924,11681,7648,14722,11477,6847,13637,
10988,1
2982,3838,10156,14486,7483,11832,13845,5879,111
84,12542,12096,7389,14489,10046,7079,13467,1110
9,7538,1
3005,11852,14501,7781,11450,13522,7122,10127,12
863,10731,5118,13617,11910,7590,14442,10939,132
01,3583,
9199,13859,7593,11668,14391,7619,13086,11491,13
612,7027,10994,15370,6128,10087,13099,12160,778
2,13421,
11098,7711,14664,11858,6906,12667,9855,13496,74
03,10718,14872,7580,11682,12985,11566,3071,1384
6,10104,
5630,12719,11208,14913,6647,11913,12895,7511,10
623,12777,14884,7540,9695,13849,7069,12035,1315
4,7943,1
1150,14449,11624,6099,13427,10162,7485,13011,11
803,14490,7390,11055,13479,4060,11375,12774,996
6,7022,1
4415,11216,7594,13537,11595,13196,7621,11478,14
605,6073,13638,10185,13006,6879,11110,13618,740
5,11573,1

5378,11157,7727,13101,9724,8001,14084,11452,5883,14444,11713,12764,4073,10967,13469,7137,10077,14914,11481,7972,13144,13968,7880,10733,14560,11672,7029,13127,9973,8002,13641,11113,14502,6094,11873,13013,7829,11860,13422,10186,7083,14855,10941,7976,12986,11815,13429,4023,14888,11171,7947,13202,11914,13524,7785,10135,14531,11493,6074,13040,10996,7138,13483,11423,15488,7772,9207,13156,7601,11100,14088,11684,7124,14606,13107,7888,11574,13642,10091,5999,14977,10739,7984,13102,11805,13538,4074,10971,12727,8004,10078,14859,12037,7070,13861,13217,7515,11874,14611,11063,8065,13850,11921,12778,6101,9974,14916,6908,11162,13699,11597,7411,12911,11383,7830,14627,10164,13620,7622,12959,11114,7085,14395,11864,13528,3965,11158,13027,6102,10193,15372,11603,7486,13728,11482,13204,7843,10742,14505,7111,13583,10139,12751,7786 ,11632,14896,8066,11173,13591,11916,6047,13131,11494,14450,7949,10188,13470,7030,12669,10983,14613,4047,11655,13649,7544,11577,12785,9977,7596,14492,11000,13862,6975,11714,13218,7833,14423,11121,13984,6115 ,10093,13109,7904,11806,14533,11598,7735,13430,10734,13014,7091,11497,15393,8008,13644,10168,13891,7793,10942,14452,11819,3966,13249,12038,5885,14506,9711,13852,6651,11161,13160,7406,14397,11439,13701,7527,10741,12780,11387,7625,14867,9919,7033,13485,11922,12919,6076,14861,11116,13433,7567,11876,13017,7955,10151,14978,11605,7759,13865,11087,12988,4081,12041,14617,7128,13511,11232,12731,7846,10194,15425,11484,7602,14096,11578,6007,13029,10687,14614,6895,13491,9211,13133,7845,11688,14862,7517,11659,13540,10973,7413,13208,14513,11937,7086,13650,10099,6105,12670,11067,14629,4027,11847,13624,11619,7626,13110,14724,9978,7834,14016,11174,7788,14427,11551,13702,7140,11447,13139,11122,7531,15380,13486,7295,9719,13018,11498,6117,14920,11177,13866,7359,11389,12786,15105,7115,10141,13893,7950,11821,13168,11203,7575,14534,11924,13705,4076,11880,13030,7034,14508,10094,13595,6106,10987,12733,11606,7604,14456,10745,13434,7794,14537,11580,7739,12759,9951,13760,6653,11505,14672,11095,7633,13665,12923,12042,7849,15616,10209, 13873,6063,11827,13220,7414,11164,14398,13515,4082,11609,12975,10974,7093,14618,10101,13375,7875,11716 ,13191,7518,14479,11661,13652,7767,11069,14439,11667,7117,13113,10155,13706,6011,14514,11471,12788,7836 ,11205,13839,7958,11938,14630,10210,7628,13894,13134,11822,7144,15394,11178,13868,7417,12049,13033,11696,4029,14429,13493,7850,10196,14980,11124,6118,13114,11621,13607,7741,14538,10746,13020,7036,11451,13597,10142,7579,14928,11500,7971,12734,13544,10989,7957,14659,11928,13436,5886,11888,15384,13250,7094,9980,13517,11185,7877,14728,11851,13224,7533,12044,13494,14633,4055,11206,12763,7608,10157,13955,11969,7007,15106,13141,11390,7796,14443,10995,13874,5631,11506,13155,10183,7857,14516,13598,11099,7542,13897 ,11829,14487,6903,11662,12925,7591,13611,11180,15396,7634,9213,13195,11610,7961,14545,13666,11720,7152,12775,11070,14620,4030,10102,13523,12983,5119,11622,14984,11669,7418,13713,11151,14430,7539,11567,13497,13034,7649,10047,14540,11833,6654,13708,11111,7742,13116,14634,11508,7581,13656,11859,15367,6108,10163,13041,13898,7771,10879,14736,11453,7123,13142,11830,13957,7534,14944,11128,13905,7636,9723,14688,11940,4059,13145,13847,11625,7823,14661,10719,12792,7097,11970,13552,14869,6121,10105,13087,11853,8068,15489,11186,13518,7973,13407,11479,14491,7783,10990,12543,13639,6907,12050,14546,10200,7852,13252,11911,14641,7878,13876,11209,13197,6071,11612,14883,11683,7597,14112,13007,9967,7118,14636,10748,13714,4084,11670,15426,13668,7962,11728,12765,11101,7420,14445,13619,10158,7541,13203,11944,14520,7773,12065,13613,14870,7098,10997,12926,11626,6122,13729,10212,14873,8016,13525,11854,14451,7858,11210,13036,13880,7881,11673,14503,11834,7023,13232,10187,14144,7800,15872,11159,13157,4071,12052,14561,11861,7650,13900,13498,11836,6013,14662,11115,12779,7974,14642,10106,13958,7125,11483,12987,11575,7595,15108,13716,11102,8072,13539,11972,14493,7582,13042,9725,15371,7126,11862,14208,10998,7391,13146,14992,11865,6095,13906,11915,14665,7831,12766,10165,13730,7860,11188,14446,13614,11685,8003,13256,12056,14453,4088,11217,13961,14548,7071,12066,12671,10189,7787,14083,15400,11875,7640,13198,11163,14507,7623,11866,13672,1
3851,60
14,11674,15112,10216,7139,13103,14666,11212,796
4,13423,11495,13264,14562,7977,11952,13643,1100
1,7882,1
4885,13526,10108,7889,13158,11917,15428,6909,11
512,13621,14874,8005,11117,13205,11633,3839,135
00,14723 ,11454,6129,13761,10166,14644,13015,788
4,11628,13529,11192,8032,14552,12781,11918,7100,
15490,11923,137
20,7978,13161,10079,14752,7774,10735,13921,1159
9,8080,14607,13908,11744,12989,7890,10943,14615,
13863,6
075,11579,14494,9975,7031,13219,13962,11485,786
4,14673,11175,13541,7545,15379,11634,13044,1187
7,7603,1
3471,14886,11218,4061,13148,9214,15008,7985,137
32,11686,13622,7129,11689,14454,12787,11715,748
7,14668,
11123,13853,6124,13019,10224,14915,7789,11878,1
4085,15373,7980,11807,13922,11002,7141,13111,14
876,1149
9,13969,7652,11676,14725,13210,7598,9726,13645,1
0743,8006,14509,13431,11607,14457,7835,11636,13
162,139
12,6130,11165,15408,12039,7130,13206,14889,1019
5,4075,13651,11581,14535,13530,7656,11486,12790,
11118,74
07,15120,13680,11690,7546,14515,11717,13221,762
7,13964,10169,15374,10975,7087,13542,14564,1150
1,7790,1
3031,11823,13703,6077,14674,12097,13625,9979,77
95,14648,13048,11233,7605,15040,13762,12068,754
8,13169,
11976,14726,13854,7035,11125,15432,12098,7986,1
3646,12782,10190,7629,14510,11925,13545,14890,7
664,1117
9,12990,12072,4062,14917,13867,12043,7837,14086,
14729,11881,13209,6103,10170,15617,13487,7142,1
1234,12
789,11868,14619,7847,13435,11697,14458,7892,112
20,13970,14784,8009,11984,13164,10095,13924,691
0,14689,
12080,13653,7797,15381,12100,13135,7519,11166,1
4089,14897,11611,7635,13280,12161,14539,6078,13
532,1019
7,14399,13626,7606,11004,12735,11507,6655,14676,
13736,11926,15492,4077,11718,13707,14730,7905,1
1181,13
021,13985,7419,10198,14863,11582,13115,7630,149
18,11939,13895,7610,11207,14892,13667,11882,760
9,13222,
14517,12162,6107,13599,10143,15395,13495,7132,1
2045,14631,11126,7637,13170,13546,11640,14621,7
415,1322
5,11692,14568,7851,11071,13437,14460,11929,8010,
13869,10211,13251,7145,15618,12000,13972,14541,
7906,11
831,13928,11187,8067,14518,13035,12104,13654,78
38,14979,11889,12793,4031,9981,14898,13628,1074
7,6132,1
5386,13553,11502,7951,13143,11623,14622,14090,7
095,11721,14921,13875,8017,11129,14635,10172,13
212,7988 ,15873,11663,13657,7896,13022,12051,146
90,11855,8096,13764,14547,11224,7146,13709,1473
7,11942,13117,79
59,11698,13715,14521,10103,6119,13519,15440,109
91,7535,13253,11941,14732,13986,8069,11613,1468
0,13870,
7798,11509,13226,11182,14922,7853,14097,10201,1
4981,7037,13744,11722,15397,11930,4083,13172,13
669,1188
4,14929,8012,12794,11236,14871,7801,11627,13499,
14576,11391,7879,13548,14542,10213,13037,6136,1
1455,13
976,15385,7421,11211,13936,14431,12046,7119,132
33,14663,11671,7859,13899,11130,14900,14092,799
2,10202,
13254,15382,11700,8070,14017,11890,15136,7854,1
3438,11835,14738,13043,7038,10749,14692,13554,1
1729,790
8,13147,11945,14643,8018,13877,10159,15496,1371
0,5887,11510,14637,13228,11189,7543,14753,11971,
13658,1
4549,4085,11614,13768,13118,7612,11863,14904,13
670,11213,7638,15620,10107,13717,15168,7153,119
32,13199 ,14924,7651,12054,13615,13881,11724,758
3,14522,11240,13159,15624,7653,11513,13556,1498
2,11946,8073,139
07,14740,10214,7963,12927,11837,14563,13501,610
9,11132,13878,15232,11675,7099,13176,15398,1206
7,13988,
7641,14930,12053,13673,7802,9982,14754,12767,11
190,7912,14638,14018,11973,15874,8020,13901,116
29,13234 ,11704,8128,14985,13527,11103,15107,714
8,13038,11892,14696,3967,14098,9727,14875,13959,
8033,11953,1545
6,11638,13257,7861,14447,10999,13660,13731,6123,
11687,14667,12796,11730,7965,14550,13718,12057,
15427,8
074,13776,11248,14645,7154,9215,13149,14524,115
14,7883,13992,14785,11635,14113,7975,13045,1174
5,15401,
13674,7642,10750,14553,13902,11838,7804,14744,1
1677,13258,14945,7862,10204,13721,14932,11867,7
101,1388
2,15504,11219,13207,6110,14887,11630,14100,1390
9,7422,11732,14986,11919,13884,7885,14565,11193,
13163,77
43,15388,10217,13531,14495,4078,12164,13623,147
56,12069,8081,13150,14646,11879,14020,7966,1542
9,11003,
13910,14877,7127,11948,13046,11974,13913,7979,1
5109,10167,13963,14946,7547,11693,13236,15402,1
1214,786
5,13733,14993,12058,14104,7599,14669,11516,1326

5,14455,6125,11637,14114,15876,11869,7775,13923,14936,11194,13211,7657,14675,10218,13914,12112,7102,14554,13722,11954,13260,8034,15409,11977,13543,14704,7891 ,11119,14000,14988,11896,7654,13049,14566,11746,13965,8076,15434,10109,13560,14727,7886,12070,13165,14649,11221,7131,13681,14786,11691,13502,4086,15632,12168,13676,14878,11678,7981,13240,14670,11222,13966 ,6079,14569,11487,13971,10191,7644,12783,15520,11927,13647,8024,14891,11956,13792,15110,8007,12099,12991,14511,11167,7893,13627,15880,11883,13533,7156,14459,11736,13223,14994,7866,11719,13682,14948,10110,8082,13925,15648,11235,13266,14677,7920,12060,13734,15113,12073,8036,13737,14556,11978,13763,7987,15888 ,11985,13171,14650,6131,11005,13926,14760,12101,7982,13855,14731,10225,13050,15552,7143,11980,13547,15009,12128,7607,13724,14919,11196,12791,8097,14691,12074,13655,15904,7658,11870,13684,14623,12176,4089,13213,14519,11986,14087,14570,7791,10171,13629,15430,11127,7839,13534,14461,11960,13166,7907,14893,11641,13738,14996,7160,13765,11699,15404,13023,12081,8084,14952,13549,11225,14678,7631,13871,11583,14652,14145,6133,10220,15491,13281,11885,14577,8011,14116,12076,15114,14024,7549,11237,15441,13173,11748,7665,14899,14146,11694,14681,13973,6911,12102,14788,13227,11931,8098,15410,14120,10226,14733,7989,14091,11226,14739,13929,14543,7894,11752,13282,15433,11503,8129,13916,15010,11642,13745,8040,14894,11723,13268,15375,11183,7660,14032,15121,11886,14128,7799,14768,10173,14148,14693,6015,11891,13214,15680,11701,13659,4090,14523,14209,11644,14572,7133,13052,11131,15000,13555,12082,7897,15493,13974,11725,14960,7868 ,13766,11760,14923,13229,11933,7611,15412,13630,10199,15116,7909,13987,15041,11238,13255,14462,8013,11943,13930,15383,11988,8088,14210,14578,12105,14093,14901,7147,11006,13174,13688,11893,7550,13740,15494 ,13119,11615,14734,7990,13977,11731,14682,14048,8019,10174,14792,13879,11702,15744,7898,13235,10751,14694,14152,6126,14741,12001,13937,15436,11515,7666,12795,14639,11726,13550,8048,14905,11706,13671,14580 ,11705,7134,13769,15497,13177,10203,7910,14931,13711,11228,14525,14099,7613,11733,15442,13903,11511,14902,7639,13272,11947,15012,13990,7803,14697,12106,13746,15416,11241,4063,13039,15042,12002,13989,14925 ,8100,12163,13661,15387,13557,7855,11934,14551,13230,10228,15122,8071,13770,12047,14983,13978,11191,7149,15457,13932,14684,12113,7993,13284,14755,12084,13675,15399,6134,11992,13439,14742,13503,12192,7668,14800,13259,11242,15016,8014,14094,12055,15619,13719,10215,7913,15137,13178,14698,11631,13748,7994,15444,12165,13938,14926,11894,7900,13883,14745,12797,11949,7614,15498,13777,11133,14906,13993,7103,12108,15124,13558,14933,11897,8130,13237,15505,11975,14019,14908,8104,10232,13662,14555,13911,11517,7643,15621,13261,11215,14647,8021,13980,11955,15044,14102,15389,8035,12088,13772,14934,12166,13288,6137,14937,13561,11950,15403,13994,7805,11134,14987,13885,12004,14757,4092,13180,15128,12114,13723,15458,8075,9983,14115,15138,11639,14101,7155,14947,13238,11708,15875,7655,14021,11734,14938,13677,14746,7863,11249,13752,15448,11747,13151,7914,14567,11679,15024,13940,15500,7996,11749,14001,14989,12169,13686,7921,14584,13047,12059,15390,13735,8022,10205,14705,13778,14526,11195,8025,14105,14700,11737,13296,15506,7157,11898,13562,14990,13683,12008,7672,14995,13793,12116,15431,12798,7967,14671,12224,13886,14816,11244,7423,15622,13725,14651,12129,13915,6138,14557,11957,13267,15625,13678,8132,10219,14706,13780,12061,14949,8077,13967,15521,12170,13241,14758,11250,7887,14212,14761,14117,11979,15936,7645,13927,12071,14787,14950,13051,8083,11738,15405,13996,11900,14879,7039,14022,14571,11958,13741,15460,7806,11197,13262,14748,14106,10206,7916,14679,13564,11518,14708,13685,8112,16000,11981,15111,13917,14653,11839,4079,13242,15411,12177,14160,14558,8037,14002,12062,14762,14025,11223,7659,15508,13167,14789,12075,13944,7867,14573,11643,15406,13794,14895,11961,7922,14118,15169,13269,11695,15435,8026,13739,10221,15140,14216,15048,6111,11871,13726,15626,11753,15170,7150,13270,14997,11198,13535,15633,13975,7646,12130,15144,14004,11987 ,15115,8136,14147,15877,11750,13215,14953,7551,12172,15464,13931,14940,11982,13784,8078,14769,13767,11227,15522,13283,7983,12077,15056,14108,15152,10175,14121,8144,15413,15172,11740,14026,14683,80

38,12120 ,14033,15553,13053,12103,8085,15233,141
49,14579,11989,15512,14028,7158,11252,14998,141
76,14790,11962,7
895,13244,15437,14122,12178,14654,13918,7661,15
011,12016,15524,14224,12132,8041,14954,14034,15
234,1208
3,13175,16128,7869,14008,10227,15117,13689,1207
8,8099,14712,15628,13747,11239,14764,14129,6140,
15634,1
1703,13273,15001,13631,7924,12193,15072,15878,1
3933,11754,14903,8028,14124,11887,15176,13285,1
5414,408
7,11935,13796,14961,14574,12003,13742,7667,1544
3,14150,11256,14695,13979,12180,7899,14793,1327
4,15417,
11727,14735,7161,13800,15123,10229,13551,15881,
13690,7991,12107,14927,15472,13771,11645,15014,
8090,132
31,11761,14770,13934,15495,8042,11007,13939,150
13,14685,12194,13749,8086,15438,13692,12085,145
81,13179 ,14794,7670,11990,15649,14130,15002,122
25,13773,8101,15554,13808,12136,14956,13981,791
1,11756,14699,15
445,13286,11895,14463,7928,13991,14527,10111,14
036,15636,15118,8049,11229,14153,15882,13054,11
993,1474
3,7162,13941,14772,11964,15418,13663,14962,7662,
11707,13779,14907,13750,12005,15528,6127,14801,
12799,1
2109,15499,14049,7870,15017,12184,13563,14582,1
5459,11243,8089,13774,15043,13754,11646,14686,1
3753,766
9,15446,12086,14935,13276,15420,12115,8044,1378
1,15004,13559,11994,15126,15640,8015,13995,1022
2,14796,
14154,14585,11762,8160,15449,13289,15018,12144,
14050,15650,7615,14211,11230,14909,14747,13982,
12006,79
01,15889,14095,15139,11709,13239,15125,7995,158
84,11735,14161,15045,14132,11899,7135,15556,147
01,14040 ,12196,14776,14240,15501,8102,11951,132
90,14964,15461,12167,14103,4091,15025,13679,112
45,14710,15507,1
4213,8050,12089,14759,13942,14802,10230,13997,8
105,15536,15129,11764,13181,15502,14156,8131,12
110,1458
6,14707,13945,12009,15890,7915,14023,14817,1568
1,12090,13565,14910,13263,7673,11996,14749,1400
3,15391,
11710,14939,8023,14136,15560,11199,14214,14702,
14804,6135,12226,13998,15450,13182,12200,14991,
8092,159 05,14052,11739,15236,14162,
15141,15652,7902,12117, 13687,14951,13756,
12131,15682,7997,15020,13782,10233 ,15046,13297,
15892,7164,11901,14765,13795,15623,13727,12171,
15130,8133,14588,13797,11251,15509,14217,1
4709,8106,11751,15462,14107,14941,11959,13243,1
5184,8052,15465,13785,12010,15026,13946,15664,7
674,1209
2,15049,14056,15656,12017,14164,14968,7917,1481
8,12118,14272,15523,13292,15142,8113,12121,1545
2,14177,
14763,11253,14005,15240,8134,15407,11768,14109,
14750,14218,15627,7923,12063,14559,13298,14999,
11519,14
027,15745,8027,15028,10234,14119,15906,15171,13
786,12228,8108,15684,13948,14955,12173,14808,14
006,7998 ,15568,11983,13245,14791,15746,13566,11
741,8079,15132,14029,15145,12179,15510,13887,15
050,7151,15513,1
1135,14225,15057,14110,11902,8039,15525,15173,1
3271,12012,15052,14123,15466,7807,15200,12208,1
3691,154
15,15146,12133,14009,8056,15688,13743,14942,117
55,15248,13919,15896,6139,11963,13801,15058,159
37,13246 ,12018,15032,7647,15908,14178,12122,147
13,14035,14771,15473,8114,10207,13798,15153,155
14,11246,14220,1
4655,4093,14030,15439,11742,14957,13275,15629,1
2232,7918,15148,14125,14820,13788,11647,15468,1
4766,813
7,14168,15938,12174,15174,14151,15584,12079,767
6,14037,15003,14824,13300,12240,15526,14575,802
9,14010,
12134,15879,14226,14714,15912,12181,7925,14064,
14795,15555,14180,11254,14958,14131,8138,14963,
11991,15
630,14126,14773,16001,11757,8087,13287,14716,13
751,12137,15883,15154,14241,7159,15635,11965,14
797,1380
2,14832,15940,12195,8043,13935,15005,13983,1565
1,10236,15015,14051,15419,8030,12020,15060,1330
4,15529,
15177,12124,14228,7926,14965,13775,15920,11763,
14687,14155,15474,8116,11995,14803,13693,15637,
14774,11
257,13809,8145,15516,15073,13055,12087,15447,14
242,14587,15557,8091,12186,14133,14798,14778,14
038,1213
8,15476,8140,14777,14273,12182,15530,14184,1480
5,15421,11766,7929,13804,14583,15891,13943,1219
7,15019,
15885,8045,13277,15178,12007,16002,14041,15074,
15235,12024,8120,14012,15641,13755,15006,12145,
15638,14
053,7663,15119,15886,11258,14157,15185,15537,14
232,11758,6141,15156,15653,13291,10223,15064,15
748,1369
4,15264,7871,11966,15451,14134,15127,14163,1218
5,14703,8103,15944,14042,15237,11765,16129,1381
0,14966,
15558,8146,12140,14192,15021,15532,13278,12111,
15180,15480,7163,14054,14969,12256,15561,13757,
15047,15
696,11711,8051,13783,14589,15422,13947,11997,15
027,15642,7930,14244,15160,12091,15503,13999,15

238,1546
3,14215,7671,11231,15022,13293,15076,15538,1219
8,14137,15186,8093,15654,13812,12146,14711,1545
3,14158,
14780,12201,8046,16004,14057,14806,15562,12227,
14138,14819,15952,7903,14044,12011,14751,15683,
13758,14
821,11769,15752,8161,13247,15241,15657,14274,12
119,15131,16130,14248,14809,8053,10231,15467,13
787,1497
0,15540,12188,14165,15080,8107,15511,14179,1199
8,15188,15569,15296,13949,15644,4094,12093,1520
1,14219,
16008,15029,11260,13299,15454,8162,15133,13799,
12229,15564,15242,14007,15658,15051,8148,12202,
14058,15
760,15143,14140,12148,15968,14810,14065,8094,15
712,11770,14972,14166,15685,15030,14169,12013,7
932,1589
3,14590,13301,15515,12209,15053,13816,15570,149
11,8109,12230,15665,14111,15249,15907,13567,120
19,15134 ,8135,15660,14276,15147,12123,15469,142
21,14715,15544,14031,7165,12204,15033,15894,137
89,14767,12094,1
4943,14825,8054,14227,15897,15202,12175,13183,1
5475,15059,13950,11247,7999,15527,14822,14060,1
5585,152
44,12135,14256,15686,15054,8115,15666,11903,141
81,15149,16132,13803,14812,12152,15517,7675,140
11,15192 ,16016,14066,10235,15175,15689,14170,80
57,15061,11743,15470,15034,13294,15477,15250,12
210,13790,6142,1
5572,15088,14280,15531,12014,15204,16136,13695,
15155,8152,12233,15690,14222,15150,15586,14127,
11772,14
775,15909,7919,14288,15265,15898,12125,14826,14
182,15747,14959,14229,8110,12021,15668,15007,13
302,1557
6,15075,12234,15776,14039,15252,8164,15631,1218
3,13805,14799,15639,15179,14185,11255,15518,813
9,14717,
14013,15697,14833,12139,14243,15910,15266,16032
,8058,14068,12126,15157,15478,14172,15062,15692,
12022,1
3811,7677,15939,15297,15900,14043,12212,15208,1
5749,13305,14828,15533,8117,12241,14967,14135,1
5481,150
65,14234,12187,15913,15036,8141,15559,14186,147
79,12236,16144,14230,15077,15539,15181,12025,81
68,13814 ,15588,15256,14245,15698,12141,14718,15
672,14055,15158,8060,16064,12216,14072,15750,15
187,15534,14193,
11759,15066,8118,15914,13306,14834,15941,10237,
15216,13806,15753,15078,14014,8031,15643,11967,
14781,15
482,14233,14807,15808,12199,13813,15713,7927,14
971,15921,14188,12242,15268,15563,15023,14159,1
5423,112
59,7166,15239,14304,15700,15161,15754,13759,121
47,14836,15887,14045,8176,15942,15182,12026,159
16,14139 ,15081,15541,15162,13279,11767,7678,156
55,15068,14246,15645,14782,12189,15592,14194,15
484,15298,8147,1
5565,12142,14249,15272,15542,14811,14275,16003,
11999,15189,8121,14059,15922,15203,15646,12257,
13817,15
945,14973,15659,14167,15243,7931,12149,15714,14
823,14236,15571,15031,12203,14046,15761,15545,8
142,1508
2,14141,15756,12258,15164,15704,13308,15089,159
46,15190,12244,8122,14277,16005,15953,14250,151
93,12190 ,15895,14840,14196,15600,8047,15135,155
66,12028,13818,15455,14591,15687,14061,15300,12
205,15924,8149,1
5245,14257,16160,15055,15762,12231,14278,15716,
14813,15667,14067,8150,15251,11261,15661,14974,
14171,15
777,15573,12150,15084,14252,15928,8095,15280,16
192,14142,12095,15205,15948,15546,14223,14827,1
6006,122
11,4095,15035,13295,15764,15587,15090,14183,117
71,16256,15194,15954,13951,8163,14814,15778,121
53,15662 ,14200,15304,16009,14719,13791,16131,10
238,7933,15246,15720,14258,15899,15151,15471,12
248,14062,15312,
15691,15574,14281,8124,15206,12015,15669,15253,
13820,15548,15809,15063,12206,14173,15577,8055,
14829,15
768,14069,15209,12260,15969,15956,14282,15037,1
5911,15267,16010,8153,12235,14231,15589,15092,1
5519,133
03,15196,12154,15780,15670,14187,14835,8165,159
01,15067,11773,14174,16133,15970,15159,16017,14
070,1525
8,12213,6143,15693,15479,14260,15210,15960,1525
4,12237,14289,15699,15578,14838,14235,8154,1572
8,15269,
12264,16012,15590,14284,15079,15751,15673,14073
,12156,15096,8111,15810,15217,14189,15902,15694,
12214,1
4830,15593,14264,15038,15915,16134,13807,8059,1
2127,15257,15535,14837,15483,14015,16018,15212,
12023,15
972,14247,15701,8166,15183,16137,15328,14290,11
262,15580,15674,14783,13307,15784,15755,15069,1
2272,793
4,16033,14195,15163,15943,15715,14074,15270,117
74,15647,15543,15218,13815,7679,15594,15273,154
85,12243 ,14237,15917,15299,16020,15976,14190,15
083,12217,15702,7167,14841,15676,14047,15601,15
191,16138,12027,
14305,15923,15260,15705,15070,14197,8156,15812,
12238,15757,15165,15763,14251,15567,15301,16034
,12218,1
4306,15918,15274,16145,8169,15792,14292,15220,1
5717,12143,14842,15547,14238,15596,15085,16024,

15984,12245,8119,14076,15281,15947,16140,15302,14253,16065,15486,12246,15091,15602,14279,15195,15925,8170,15758,15276,12191,13309,15706,15816,15166,14198,15718,15765,15247,12259,15663,8061,14143,15929,15207,15604 ,15955,14259,14975,12029,15549,15926,15224,13819,16036,15721,8143,14815,12220,16066,14201,15949,15282,15575,15086,16146,14296,12151,16007,15305,15708,15779,8062,14063,14844,15766,15824,12249,15197,14254,16040,16161,15093,15722,14308,15950,15306,8177,12261,15769,15930,14283,15255,16148,15957,15932,15211,10239,14202,15579,15671,15198,16068,8123,13821,15958,15094,12250,15961,16011,14261,15284,15781,16152,15313,16162,12207,14285,15971,8172,15259,15962,15770,14312,15308,15591,16048,12155,15097,14204,16013,15608,15213,15729,15550,8178,14262,12262,15724,15288,16014,16019,14175,14831,15695,15840,15039,12030,15675 ,14071,15581,8125,15271,15730,15973,15314,13310,15782,11775,15785,15811,15219,14320,15974,15903,15098,15595,15772,8151,11263,13822,14839,15703,15732,15261,16135,14291,15677,15582,12252,15214,15786,15813,14265,15071,8126,15597,15919,16193,14075,12265,15329,16164,16072,15221,16194,14286,16021,15275,16168,12215,16139,8155,15977,14266,15330,15964,15793,15316,16080,14191,16176,12266,16196,15262,15707,16257,14293,15100,8180,15603,16022,15814,15277,12157,14294,15678,16035,15303,15978,16258,14239,16141,15222,12239,15736,15788,8167,15167,16025,14307,16096,15927,15283,16200,15985,12158,14077,14843,15598,15719,15817 ,15225,14268,15759,16147,8184,15951,12273,15320,16038,15794,14199,15087,16037,15709,15605,15278,14297,12219,15818,16026,15980,15332,7935,15723,15487,14309,15551,15307,16142,15767,12268,15226,14298,15796,15986,15931,14845,15825,16041,14255,15606,8157,12274,15285,16067,15710,15959,15309,14203,16028,16150,15820,15336,15609,12221,16042,14310,15933,15228,15771,16163,8171,16149,14078,15286,16069,15725,12247,15800,15199,15988,13823,16049,15734,15095,15783,15826,16153,15344,12222,13311,8158,15610,15731,15841,14846,15934,15773,14300,15963,15315,15726,15828,12251,16015,15289,14313,16260,16165,15975,15099,8173,16044 ,16070,14263,15789,15310,12276,16154,15612,15733,15965,15290,14314,16208,16050,16073,15215,15992,12263 ,15842,14205,16166,8127,15317,15787,16264,15774,15318,15583,14287,16023,16052,16195,12280,15263,15979,15832,15815,14206,15331,16156,16169,16074,8179,16081,15101,16197,12031,14321,16076,16224,15292,16170,15966,16272,16082,14267,15223,16056,15737,15795,12253,16177,15321,15679,8181,14316,15981,16172,15333,15844,15790,16198,16027,14322,15322,12267,15848,15599,15738,15819,15279,15982,14269,15987,15797,15740,15227,8063,16178,15821,15856,12254,16029,14295,15334,16039,16084,16201,15102,15989,15711,15827,14270,15798,14847,12269,16097,15611,15822,15802,15801,8174,14299,15324,15829,15607,16043,16202,15337,16098,16259,16030,12223,14324,16143,15287,16209,16180,16088,16288,15338,16151,14311,15727,16261,15990,8182,16045 ,15229,12275,16204,15993,16071,14328,15613,15311,16051,16184,16262,16046,15230,16100,16210,14079,15735 ,12277,15804,15830,15345,15843,15775,8185,15845,16265,16155,14301,15291,15833,15994,16104,16212,16320,15340,12159,16225,16053,14315,16157,16266,15346,16075,16167,15834,15996,16054,15293,14302,15614,8186,16077,15935,12270,16273,16158,15319,16171,15739,16057,15791,14317,15967,15849,15294,16226,16083,15846,16268,16078,15323,12278,16173,14271,15836,16216,16199,16085,8159,15348,16058,16274,16112,16228,16179,14323,16174,15335,15799,16289,15850,12281,15983,16031,16099,15352,16276,15823,14325,16203,15741,15857,15103,16290,16181,16086,16321,8188,16232,15852,15991,14207,12282,15325,16089,16060,15803,16101,16205,16280,15339,15742,16182,16211,16090,14318,15858,16240,15326,16102,15805,15831,15995,12255,16292,16047,16263,15341,16185,8175,14326,15860,16206,16105,16186,16092,15806,15295,16322,16296,15835,16213,16227,14329,15997,12284,16267,15347,15847,16055,16106,16188,16113,16214,16217,15349,15864,16159,15615,14330,16324,16269,8183,16079,15837,16275,15231,15998,16108,16304,12271,16229,15851,16059,16114,16218,14303,15342 ,15838,16328,15743,16270,16175,16336,16230,16277,15350,16087,15853,16233,16061,16291,14332,16116,16220 ,12279,15859,8187,16091,15353,16183,16282,16234,16278,15862,16293,16103,16120,16241,15354,15854,14319,16062,16281,15861,16236,16207,16352,15807,16093,16187,15327,16294,12283,16242,16297,16323,16107,15865,16215,14327,16284,16094,16189,15356,16325,8189,16298,16244,15866,16109,16305,16326,16115,16219,16300,16190,16271,15343,16231,15999,16248,14331,15839,16306,12285,16110,16329,15868,16221,16117,16330,16279,15351,16235,16222,16118,16308,16337,16283,16332,16121,16237,16312,15855,14333,16063,16295,8190,16338,15355,16243,16122,15863,16285,16238,16095,16353,16245,16299,12286,16354,16340,16286,16124,16301,16327,15357,16246,16191,16307,15867,16249,14334,16344,16111,16302,16356,16331,16250,15869,16309,16333,16360,16252,16310,16223,16119,15358,16368,15870,16339,16313,16123,16334,16314,16239,8191,16341,16342,16287,12287,16355,16125,16316,16247,16345,16357,14335,16346,16303,16251,16358,16126,15871,15359,16348,16361,16311,16362,16253,16335,16254,16369,16315,16364,16370,16317,16343,16318,16347,16372,16359,16376,16127,16349,16363,16350,16365,16319,16371,16373,16255,16366,16374,16377,16378,16351,16380,16367,16375,16379,163 81,16382,16383]

**Sequence group 3: Z3_16384**

[0,1,2,7,3,8,15,28,4,14,17,32,20,37,39,86,5,16,18,36,23,43,53,91,26,52,47,99,65,109,116,186,6,21,25,45 ,27,51,59,101,33,63,67,110,80,123,129,206,38,69,84,127,89,138,149,220,98,151,164,249,170,264,289,420,9,22,30,62,34,66,79,118,40,85,71,130,94,142,157,230,50,82,97,150,103,160,169,258,114,172,191,276,205,296,315,469,61,100,112,168,125,180,199,292,136,200,219,307,233,334,353,510,154,228,253,339,261,354,382,546,282,389,414,576,436,602,651,918,19,29,35,81,44,88,92,155,55,96,104,167,115,179,183,291,64,105,117,181,128,198,216,309,141,217,229,328,255,349,375,534,73,121,137,204,143,218,236,340,165,251,262,357,281,388,406,572,182,273,293,397,308,430,439,599,336,454,491,638,518,674,755,919,77,139,159,239,177,259,280,393,188,284,299,419,317,438,466,625,213,312,329,451,355,483,513,688,368,521,551,717,584,769,800,1075,235,343,362,495,399,530,557,744,435,567,600,787,639,806,880,1163,465,614,654,844,670,905,939,1242,749,957,997,1226,1040,1308,1417,1806,24,41,46 ,102,56,107,119,197,58,120,132,207,145,231,242,373,72,133,146,246,161,254,270,374,171,268,290,412,313,434,446,598,75,158,173,248,193,274,294,433,203,305,318,448,332,481,502,668,202,330,346,478,367,517,536,722,401,561,586,767,610,796,852,1139,87,185,195,301,211,325,345,471,223,352,361,511,383,545,566,763,286,376,400,550,422,582,609,792,457,619,659,840,693,901,943,1211,322,416,450,595,477,636,662,883,507,680,704,914,756,976,1014,1282,554,754,773,999,793,1042,986,1333,863,1131,1167,1441,1183,1558,1624,1895,93,208,214,366,275,387,404,560,303,409,425,589,456,623,658,887,320,453,476,624,494,665,696,925,522,709,742,965,789,1007,1071,1347 ,372,482,500,694,535,731,776,989,587,777,802,1066,867,1034,1151,1448,634,832,897,1132,926,1178,1219,1521,977,1234,1231,1608,1336,1657,1716,2095,415,519,562,781,621,805,850,1091,660,885,907,1171,955,1190,1229,1550,698,935,991,1215,1015,1239,1340,1663,1088,1362,1405,1732,1481,1827,1883,2318,764,1002,1059,1344,1148,1350,1465,1756,1161,1453,1529,1860,1591,1936,2046,2499,1191,1562,1644,1974,1691,2065,2013,2564,1794,2153,2215,2755,2351,2864,3000,3415,31,49,60,113,68,134,147,237,74,152,163,245,176,266,271,426,76,174,184,265,196,326,337,464,224,338,365,508,386,538,564,786,78,192,209,331,226,363,379,527,238,392,407,570,429,603,631,808,252,418,443,617,472,655,677,873,484,669,711,932,716,964,1004,1425,122,225,234,384,247,408,427,592,278,447,459,645,489,683,707,892,300,463,499,673,525,714,725,948,549,727,741,1009,831,1046,1118,1450,321,524,541,737,578,774,782,1026,608,826,856,1087,913,1142,1173,1533,644,879,930,1176,981,1207,1289,1595,1057,1300,1367,1669,1409,1747,1837,2300,126,244,267,440,297,460,493,690,314,504,528,730,555,748,758,1018,351,544,577,761,606,819,849,1076,640,869,909,1158,950,1196,1259,1538,380,591,628,854,679,900,896,1199,700,937,960,1245,1030,1294,1323,1677,745,983,1051,1313,1080,1386,1413,1761,1127,1445,1497,1865,1603,1949,2053,2510,403,650,682,942,723,973,1031,1304,815,1055,1101,1398,1108,1420,1473,1819,834,1103,1124,1460,1201,1493,1575,1933,1273,1599,1640,1979,1712,2105,2175,2599,871,1221,1253,1542,1324,1612,1653,2027,1371,1701,1768,2148,184 4,2224,2333,2795,1505,1778,1873,2250,1963,2369,2
420,2970,2035,2468,2555,3050,2683,3196,3389,4048
,144,279 ,306,505,347,539,571,795,359,583,615,824,
647,862,922,1262,394,633,689,890,713,969,952,1281
,733,993,1039,13
59,1095,1390,1433,1798,475,703,736,968,813,1023,1
063,1401,823,1096,1116,1437,1147,1477,1519,1906,
836,113
6,1186,1514,1268,1571,1629,1987,1315,1687,1707,2
109,1772,2184,2273,2730,486,811,818,1082,839,110
6,1154,1
490,875,1206,1249,1555,1296,1615,1697,2082,1047,
1266,1328,1636,1374,1736,1782,2161,1485,1789,187
6,2255,1
967,2361,2411,2953,1112,1381,1456,1740,1510,1853
,1919,2290,1586,1941,2001,2401,2074,2478,2589,31
03,1648,
2039,2126,2544,2210,2624,2722,3237,2308,2769,285
0,3347,2923,3550,3602,4530,496,843,858,1254,1020,
1286,13
19,1681,1067,1355,1394,1752,1468,1814,1899,2282,
1120,1429,1502,1830,1546,1925,2006,2389,1620,206
0,1993,2
449,2170,2575,2673,3157,1276,1525,1567,1955,1673
,2018,2116,2520,1728,2130,2201,2635,2264,2698,28
09,3324,
1849,2233,2326,2744,2429,2878,2938,3492,2491,303
3,3087,3667,3214,3764,3842,4321,1378,1583,1723,2
139,181
0,2193,2241,2709,1889,2343,2380,2839,2457,2893,3
065,3576,1911,2439,2531,3018,2659,3121,3137,3801
,2784,32
59,3299,3880,3443,4102,4201,5005,2087,2614,2648,
3175,2824,3276,3371,3961,2908,3469,3518,4151,370
2,4260,4
609,5281,2985,3635,3731,4386,3917,4451,4692,5450
,4007,4790,4893,5669,5127,5940,6352,7046,10,42,70
,153,90,
166,201,319,108,189,221,350,250,385,398,632,124,2
12,232,377,277,417,474,652,302,467,444,686,531,72
4,752,10
08,140,260,295,431,310,462,498,695,356,520,543,72
8,607,784,807,1070,390,552,622,798,646,837,878,11
13,681,8
86,927,1200,949,1240,1309,1680,178,269,333,514,36
4,537,601,762,405,627,559,812,666,851,904,1141,45
5,616,67
6,881,705,915,947,1224,743,959,1016,1277,1065,133
5,1388,1803,509,691,734,941,788,982,1044,1321,827
,1050,1
111,1365,1149,1438,1495,1910,893,1133,1212,1459,
1233,1498,1574,1998,1299,1597,1660,2068,1720,213
4,2247,2
832,241,327,370,613,424,643,656,898,480,672,710,9
36,747,979,995,1317,526,715,757,987,803,1041,1097
,1372,84
6,1102,1138,1419,1220,1483,1557,1964,569,775,833,
1062,855,1105,1162,1463,933,1205,1235,1507,1295,
1593,16
38,2064,992,1267,1327,1614,1368,1704,1729,2123,1
443,1766,1858,2218,1926,2303,2485,2835,590,842,9
10,1172,
975,1227,1291,1606,1012,1303,1341,1675,1391,1724
,1802,2189,1090,1376,1424,1760,1503,1841,1918,23
30,1540,
1934,2011,2403,2091,2517,2586,3142,1156,1467,152
0,1869,1619,1959,2023,2461,1717,2050,2128,2558,2
221,260
3,2759,3310,1796,2158,2253,2687,2294,2806,2875,3
452,2474,2912,2989,3423,3073,3572,3772,4477,288,
410,437,
702,485,721,766,1035,492,770,817,1072,865,1143,11
77,1549,563,821,868,1187,921,1216,1260,1552,953,1
256,131
4,1656,1380,1713,1744,2120,579,908,961,1197,1025,
1271,1330,1708,1056,1357,1395,1749,1435,1834,188
8,2286,
1052,1426,1474,1829,1537,1921,1972,2407,1627,203
1,2093,2514,2156,2582,2702,3262,637,1003,1028,13
49,1085,
1411,1472,1808,1117,1491,1515,1914,1578,1994,204
5,2503,1306,1561,1623,2008,1684,2079,2149,2568,1
776,217
4,2268,2677,2346,2802,2886,3399,1407,1667,1755,2
115,1825,2211,2276,2763,1903,2315,2372,2828,2488
,2945,30
21,3529,2016,2481,2523,2993,2572,3078,2967,3620,
2725,3245,3313,3813,3342,4033,4158,4637,661,1078
,1093,15
32,1275,1589,1635,2028,1354,1652,1689,2101,1771,
2181,2261,2772,1399,1764,1822,2185,1868,2279,235
5,2846,1
940,2382,2456,2927,2562,3010,3132,3646,1544,1838
,1884,2347,1970,2432,2534,2974,2098,2538,2592,31
24,2726,
3061,3287,3824,2207,2655,2791,3251,2852,3338,340
8,3967,2949,3438,3433,4121,3624,4216,4314,4973,1
664,192
9,2037,2540,2178,2596,2694,3171,2272,2766,2813,3
320,2904,3357,3429,4019,2358,2867,2978,3405,3025
,3448,36
31,4224,3167,3675,3749,4345,3890,4510,4617,5333,
2506,2996,3112,3641,3280,3653,3861,4395,3306,383
6,3980,4
573,4087,4712,4904,5607,3361,4041,4186,4769,4275
,4931,4842,5718,4459,5070,5172,6011,5383,6175,63
99,7006,
341,449,503,738,547,825,872,1165,575,891,924,1185
,970,1248,1263,1692,585,966,1000,1243,1033,1416,1
447,179
1,1123,1455,1528,1904,1585,1978,2042,2551,596,10
19,1081,1430,1128,1523,1566,1952,1168,1602,1643,
2056,170
0,2137,2198,2607,1210,1671,1739,2167,1813,2259,2
305,2741,1845,2287,2386,2860,2397,2919,3004,3782
,779,112 6,1153,1579,1193,1647,1696,2112,1284,1745,1780,2235,1856,2325,2376,2780,1346,1787,1880,2296,1948,2394,2418,2890,2002,2423,2452,3014,2652,3083,3223,3830,1404,1944,1985,2445,2077,2527,2547,3044,2144,2644,2713,3163,2820,3269,3327,3988,2229,2752,2856,3331,2959,3393,3539,4094,3107,3561,3679,4231,3753,4371,4538,5307,794,1182,1250,1733,1337,1784,1864,2339,1385,1891,1957,2426,2021,2470,2494,3029,1486,1989,2072,2498,2142,2631,2691,3146,2225,2733,2817,3296,2897,3365,3483,3992,1569,2106,2196,2705,2312,2798,2787,3375,2364,2871,2916,3459,3054,3543,3598,4246,2464,2963,3094,3581,3150,3712,3760,4403,3241,3820,3924,4582,4116,4732,4910,5624,1631,2243,2321,2882,2414,2942,3058,3565,2620,3099,3189,3735,3206,3776,3873,4501,2663,3193,3233,3854,3379,3909,4067,4703,3509,4109,4179,4781,4306,4982,5103,5767,2737,3419,3473,3999,3608,4128,4209,4863,3686,4290,4410,5059,4545,5184,5357,6073,3936,4427,4590,5220,4752,5409,5493,6327,4872,5563,5700,6470,5886,6688,6970,7960,861,1287,1360,1896,1478,1982,2058,2579,1511,2084,2164,2642,2238,2719,2843,3489,1610,2203,2337,2776,2393,2934,2901,3525,2436,2981,3069,3663,3179,3719,3794,4469,1818,2368,2443,2930,2616,3040,3115,3741,2638,3182,3219,3805,3273,3886,3955,4655,2666,3255,3352,3948,3503,4060,4167,4801,3587,4267,4299,4994,4418,5115,5257,5974,1850,2610,2627,3153,2670,3200,3290,3905,2748,3385,3463,4026,3555,4136,4282,4954,3090,3499,3614,4171,3690,4353,4435,5082,3898,4442,4598,5233,4761,5395,5477,6304,3210,3708,3849,4360,3943,4565,4675,5295,4079,4722,4821,5464,4942,5577,5749,6549,4194,4884,5026,5686,5160,5798,5955,6749,5319,6031,6155,6906,6259,7235,7322,8589,1875,2680,2716,3477,3036,3535,3591,4255,3128,3657,3724,4379,3868,4494,4646,5269,3228,3789,3928,4521,4014,4683,4830,5438,4143,4922,4810,5534,5094,5732,5867,6630,3513,3974,4053,4741,4239,4850,5014,5638,4338,5038,5148,5816,5245,5904,6093,6872,4554,5196,5345,5992,5506,6195,6282,7155,5594,6450,6523,7412,6716,7552,7662,8324,3696,4075,4329,5050,4486,5139,5208,5921,4626,5371,5421,6130,5549,6218,6498,7278,4663,5520,5655,6425,5849,6576,6604,7606,6054,6777,6839,7713,7082,8028,8171,9200,4963,5781,5830,6661,6111,6811,6942,7832,6237,7118,7199,8099,7459,8246,8695,9550,6374,7367,7505,8406,7775,8496,8803,9766,7892,8917,9054,10043,9365,10371,10841,11646,11,48,83,194,111,210,272,423,135,257,298,461,335,506,523,828,156,285,311,497,369,558,626,860,402,620,588,899,699,951,984,1302,175,348,391,574,413,611,657,912,470,685,712,956,797,1022,1054,1379,515,726,816,1043,847,1089,1140,1431,895,1150,1204,1539,1232,1587,1674,2092,227,358,441,678,479,706,791,994,532,822,739,1058,877,1109,1175,1466,604,809,889,1145,923,1189,1228,1568,974,1241,1316,1632,1375,1703,1765,2230,671,906,962,1222,1032,1274,1348,1686,1079,1353,1428,1738,1479 ,1828,1886,2344,1164,1457,1556,1843,1580,1890,1973,2440,1658,1999,2070,2519,2135,2587,2710,3372,323,432,488,804,565,841,864,1170,635,882,929,1218,978,1270,1288,1682,692,934,990,1279,1048,1343,1414,1746,1104,1418,1462,1804,1564,1871,1954,2406,753,1010,1083,1369,1114,1423,1492,1848,1208,1547,1584,1900,1654,1996,2049,2511,1283,1621,1690,2017,1741,2119,2147,2576,1833,2188,2289,2678,2363,2775,2980,3378,778,1094,1184,1504,1261,1573,1650,2010,1307,1662,1709,2088,1770,2143,2223,2647,1406,1754,1809,2180,1894,2269,2352,2807,1935,2374,2454,2888,2539,3016,3093,3728,1487,1854,1913,2302,2025,2399,2469,2955,2133,2497,2580,3060,2682,3108,3285,3921,2220,2615,2717,3203,2764,3344,3425,4090,2969,3465,3556,4055,3650,4227,4448,5178,381,540,580,916,642,940,1001,1339,648,1006,1064,1382,1125,1469,1513,1945,746,1069,1130,1527,1194,1560,1613,1950,1237,1604,1679,2067,1757,2129,2162,2574,765,1179,1246,1534,1326,1626,1695,2125,1366,1730,1773,2169,1820,2263,2320,2757,1361,1812,1863,2256,1930,2359,2412,2896,2032,2480,2546,3011,2608,3085,3220,3870,835,1297,1329,1719,1397,1793,1859,2234,1440,1881,1909,2350,1977,2437,2493,3003,1665,1958,2030,2451,2096,2532,2604,3071,2197,2629,2736,3191,2822,3335,3435,4024,1788,2078,2176,2567,2251,2671,2746,3293,2334,2790,2851,3367,2984,3507,3594,4173,2462,2976,3024,3559,3075,3659,3531,4278,3247,3852,3931,4497,3964,4729,4858,5328,87
0,1387,1410,1928,1630,1992,2041,2476,1725,2059,2
102,2552,2194,2639,2732,3303,1781,2183,2248,2643
,2299,27
49,2833,3392,2377,2862,2948,3482,3068,3578,3721,
4308,1943,2266,2317,2825,2409,2922,3035,3537,255
0,3039,3
097,3711,3252,3640,3896,4513,2667,3168,3326,3856
,3396,3957,4038,4657,3512,4072,4066,4824,4285,49
16,5020,
5664,2073,2365,2482,3046,2632,3104,3213,3766,273
9,3297,3348,3937,3460,3978,4063,4715,2836,3412,3
542,403
2,3595,4082,4293,4925,3757,4339,4424,5047,4576,5
214,5310,6023,3006,3568,3695,4300,3889,4317,4542
,5091,39
14,4518,4672,5272,4792,5403,5586,6307,3983,4738,
4896,5467,4976,5617,5529,6403,5157,5759,5860,669
4,6076,6
858,7067,7674,452,597,663,967,720,1073,1135,1496,
759,1155,1198,1522,1255,1596,1618,2107,772,1252,
1293,15
92,1334,1797,1835,2216,1444,1840,1924,2338,1988,
2419,2490,3056,785,1320,1392,1817,1454,1915,1965
,2390,15
00,2007,2051,2505,2114,2591,2658,3114,1551,2085,
2154,2626,2237,2721,2782,3271,2274,2760,2870,340
6,2885,3
479,3574,4465,1017,1449,1484,1980,1531,2054,2110
,2563,1641,2166,2202,2695,2283,2801,2859,3316,17
14,2213,
2313,2771,2384,2877,2907,3442,2448,2911,2944,358
5,3165,3666,3826,4515,1786,2381,2427,2937,2526,3
028,304
9,3621,2601,3160,3231,3756,3362,3877,3945,4680,2
693,3283,3402,3949,3520,4017,4188,4798,3692,4212
,4347,49
36,4432,5076,5229,5997,1038,1516,1601,2151,1706,
2205,2295,2814,1762,2328,2395,2918,2466,2965,299
1,3604,1
879,2434,2522,2995,2595,3139,3209,3733,2686,3261
,3354,3912,3450,3990,4124,4689,1969,2559,2654,32
24,2786,
3334,3321,3998,2840,3421,3472,4097,3628,4197,425
7,4951,2957,3526,3677,4234,3740,4384,4439,5100,3
845,450
4,4606,5278,4816,5424,5597,6319,2036,2706,2797,3
432,2899,3500,3633,4219,3129,3683,3785,4409,3804
,4456,45
59,5202,3177,3792,3837,4535,4005,4600,4764,5392,
4154,4807,4887,5473,5011,5678,5795,6454,3265,404
5,4112,4
697,4263,4833,4909,5554,4356,4997,5112,5752,5242
,5875,6046,6755,4623,5130,5292,5915,5444,6104,61
81,7021,
5566,6254,6386,7140,6581,7356,7637,8526,1119,164
6,1734,2331,1866,2424,2509,3082,1905,2535,2619,3
151,270
3,3242,3383,4131,2014,2664,2811,3307,2873,3495,3
455,4169,2925,3548,3648,4332,3773,4392,4480,5166
,2246,28
48,2933,3490,3126,3615,3704,4416,3147,3778,3817,
4489,3884,4568,4649,5351,3181,3864,3971,4640,414
6,4755,4
866,5487,4242,4967,5003,5689,5121,5809,5952,6652
,2281,3118,3136,3747,3186,3798,3902,4593,3275,40
11,4104,
4720,4204,4839,4988,5644,3670,4139,4270,4878,436
3,5056,5136,5773,4585,5151,5301,5926,5453,6088,6
167,699
5,3810,4377,4527,5065,4632,5260,5374,5981,4784,5
412,5510,6150,5631,6271,6437,7219,4901,5574,5713
,6369,58
52,6489,6638,7418,6008,6713,6834,7577,6951,7866,
7940,9112,2307,3199,3234,4115,3611,4182,4249,496
0,3715,4
324,4400,5085,4551,5193,5339,5966,3829,4472,4615
,5223,4706,5380,5517,6135,4848,5610,5497,6226,57
87,6416,
6563,7300,4161,4666,4746,5432,4945,5540,5704,633
6,5041,5724,5838,6506,5937,6599,6772,7541,5251,5
889,603
7,6675,6198,6883,6976,7787,6291,7113,7193,8036,7
384,8163,8267,8864,4368,4775,5032,5738,5187,5824
,5900,66
16,5322,6062,6119,6820,6242,6903,7166,7906,5360,
6209,6349,7093,6540,7246,7269,8211,6735,7448,751
1,8311,7
718,8597,8720,9668,5652,6476,6528,7328,6797,7476
,7614,8420,6926,7750,7820,8654,8077,8787,9209,99
86,7042,
7988,8120,8945,8360,9017,9302,10186,8474,9417,95
29,10437,9816,10724,11167,11871,243,548,732,1160
,853,12
13,1356,1777,945,1310,1436,1874,1543,1984,2022,2
660,1027,1400,1475,1960,1637,2081,2242,2714,1722
,2228,21
57,2803,2402,2903,2973,3582,1099,1577,1698,2121,
1750,2208,2309,2829,1898,2371,2431,2914,2598,305
3,3110,3
717,2003,2460,2636,3089,2699,3185,3279,3814,2793
,3301,3398,4002,3446,4085,4230,4957,1264,1609,18
24,2356,
1920,2415,2584,2999,2044,2650,2473,3122,2753,321
7,3340,3874,2190,2622,2779,3289,2855,3369,3439,4
051,295
2,3466,3600,4164,3706,4281,4389,5175,2341,2818,2
929,3426,3064,3522,3661,4252,3161,3673,3808,4342
,3893,44
91,4603,5354,3317,3858,4029,4532,4070,4612,4758,
5503,4206,4804,4919,5621,5029,5727,5912,6805,150
9,1800,1
939,2612,2100,2689,2728,3330,2260,2768,2866,3416
,2962,3516,3552,4245,2387,2881,2988,3533,3100,36
54,3780,
4358,3205,3788,3865,4454,4043,4579,4726,5447,250

2,3031,3172,3699,3227,3796,3918,4539,3410,4009,4
078,462
9,4198,4795,4881,5614,3546,4142,4264,4836,4350,5
000,5044,5710,4500,5109,5266,5864,5386,6000,6279
,6814,25
56,3195,3358,3940,3505,4057,4191,4818,3589,4213,
4296,4948,4398,5035,5169,5821,3762,4365,4462,509
7,4620,5
239,5366,6042,4695,5398,5526,6158,5658,6332,6433
,7274,3908,4548,4652,5289,4845,5441,5546,6246,50
23,5589,
5721,6391,5870,6459,6699,7524,5163,5770,5918,658
5,5986,6769,6878,7730,6266,6931,7051,7687,7177,7
900,817
7,9045,1670,2063,2140,2844,2277,2892,3008,3644,2
292,3020,3133,3725,3248,3881,3952,4709,2486,3143
,3256,39
76,3381,4036,4127,4718,3456,4119,4237,4913,4374,
5017,5068,5707,2529,3351,3476,3995,3618,4149,427
2,5008,3
688,4326,4406,5079,4483,5226,5316,5969,3682,4466
,4562,5217,4686,5377,5461,6162,4861,5560,5661,63
24,5763,
6428,6607,7454,2675,3569,3627,4311,3750,4437,455
6,5181,3821,4595,4643,5363,4766,5500,5583,6311,4
221,473
5,4855,5523,4964,5641,5756,6408,5124,5792,5944,6
568,6065,6763,6892,7650,4430,4934,5088,5696,5211
,5856,59
60,6702,5342,6020,6107,6800,6287,6986,7098,7840,
5537,6274,6341,7057,6411,7182,7015,7966,6643,742
9,7530,8
225,7572,8512,8662,9240,2742,3737,3769,4677,4156
,4787,4875,5557,4318,4907,4970,5675,5118,5806,59
32,6721,
4413,5106,5205,5813,5284,5963,6080,6830,5406,612
4,6234,6956,6394,7077,7263,8000,4700,5236,5313,6
068,545
7,6203,6357,7026,5672,6361,6442,7252,6649,7160,7
488,8240,5844,6537,6744,7437,6844,7564,7668,8428
,6990,77
05,7699,8621,7974,8737,8856,9631,4928,5389,5569,
6366,5801,6445,6593,7317,5948,6708,6783,7535,692
2,7589,7
693,8488,6085,6864,7031,7656,7104,7724,7980,8745
,7311,8042,8142,8889,8332,9093,9220,10055,6316,7
062,723
0,7994,7482,8008,8289,8953,7518,8260,8444,9161,8
572,9322,9540,10356,7595,8518,8704,9396,8812,958
4,9472,1
0490,9026,9739,9866,10799,10113,10984,11215,118
37,1851,2171,2322,2940,2444,3155,3266,3926,2515,
3311,338
8,3968,3496,4100,4134,4979,2543,3486,3563,4091,3
637,4445,4507,5154,3833,4524,4669,5348,4778,5470
,5580,63
83,2570,3607,3744,4475,3846,4660,4743,5427,3933,
4813,4890,5600,4991,5735,5835,6462,4021,4939,506
2,5784,5
190,5929,6003,6671,5248,5977,6127,6853,6147,6945
,7073,8192,3043,3839,3900,4772,3986,4898,4985,56
93,4176,
5073,5133,5892,5263,6034,6116,6730,4303,5145,530
4,5989,5418,6142,6178,6897,5514,6186,6229,7087,6
532,718
8,7395,8254,4421,5415,5484,6223,5635,6344,6378,7
135,5744,6520,6621,7306,6791,7465,7547,8450,5881
,6685,68
48,7558,7001,7643,7852,8581,7224,7880,8048,8753,
8148,8925,9121,10013,3079,3959,4106,5053,4288,51
42,5275,
6057,4382,5325,5435,6190,5543,6262,6296,7107,458
8,5490,5627,6299,5741,6501,6590,7283,5878,6657,6
786,749
9,6911,7600,7769,8458,4749,5683,5827,6612,6015,6
758,6741,7620,6096,6867,6936,7736,7146,7860,7934
,8770,62
51,7012,7208,7912,7289,8091,8156,8962,7423,8232,
8368,9169,8613,9342,9561,10390,4869,5907,6026,68
87,6170,
6981,7149,7886,6484,7213,7345,8128,7373,8185,830
3,9082,6545,7350,7407,8281,7625,8354,8550,9311,7
807,860
5,8687,9406,8847,9643,9789,10541,6666,7681,7755,
8466,7946,8630,8728,9494,8056,8828,8972,9728,913
0,9881,1
0085,10881,8384,8989,9180,9920,9374,10143,10232,
11143,9506,10309,10472,11288,10666,11500,11803,
12694,3
238,4183,4335,5336,4571,5480,5603,6420,4635,5647
,5778,6515,5896,6635,6825,7781,4827,5841,6050,67
27,6139,
6967,6917,7826,6206,7037,7171,8022,7334,8105,820
5,9037,5199,6099,6214,6961,6481,7129,7241,8134,6
510,733
9,7390,8219,7471,8317,8412,9260,6554,7442,7583,8
398,7801,8542,8671,9428,7920,8795,8839,9654,8981
,9804,99
59,10760,5254,6467,6493,7295,6559,7362,7493,8346
,6680,7631,7744,8504,7872,8638,8820,9608,7202,77
95,7954,
8679,8062,8900,8998,9754,8338,9009,9189,9932,938
5,10128,10217,11119,7378,8085,8275,8908,8390,915
0,9280,
10001,8566,9331,9451,10201,9596,10325,10522,113
65,8712,9517,9692,10456,9854,10576,10740,11555,1
0028,10
819,10964,11739,11075,12053,12129,13238,5298,65
71,6626,7761,7124,7846,7926,8778,7258,8014,8113,
8936,829
5,9073,9251,9974,7401,8197,8376,9102,8480,9291,9
460,10171,8646,9573,9440,10278,9777,10506,10647,
11443,7
814,8436,8534,9354,8762,9483,9680,10405,8881,970
4,9842,10592,9947,10685,10901,11705,9141,9893,10
070,107

79,10247,11008,11095,11975,10340,11264,11337,12
209,11526,12341,12433,13010,8071,8558,8873,9716,
9065,98
28,9905,10704,9229,10098,10158,10944,10293,1102
8,11312,12089,9271,10263,10421,11239,10630,1139
0,11418,
12387,10861,11584,11675,12484,11905,12753,12877
,13732,9619,10557,10611,11472,10921,11616,11769,
12584,1
1051,11940,12014,12812,12254,12939,13321,13998,
11191,12169,12295,13083,12536,13158,13411,14157
,12641,1
3509,13616,14343,13853,14576,14866,15285,12,54,9
5,240,131,263,360,556,162,342,395,605,442,664,687,
1092,19
0,378,411,653,487,729,829,1129,529,820,771,1181,9
20,1244,1292,1694,215,458,516,750,542,810,866,119
5,618,90
2,938,1251,1045,1338,1377,1790,675,954,1077,1364,
1115,1427,1488,1857,1174,1501,1570,1991,1605,205
2,2160,
2665,283,473,581,894,629,928,1037,1305,697,1084,9
72,1384,1152,1452,1535,1902,801,1060,1166,1494,1
209,155
3,1600,2029,1278,1617,1711,2108,1785,2191,2270,2
830,884,1188,1265,1594,1351,1661,1753,2173,1415,
1758,185
2,2236,1917,2345,2417,2968,1518,1892,2009,2366,2
043,2421,2525,3080,2136,2553,2641,3174,2720,3253
,3397,41
10,428,568,641,1053,740,1107,1137,1524,838,1159,1
217,1588,1285,1655,1678,2168,911,1223,1298,1666,
1370,17
48,1836,2244,1446,1842,1897,2319,2020,2400,2500,
3041,988,1325,1421,1779,1458,1846,1932,2370,1576
,2000,20
47,2433,2132,2549,2613,3162,1672,2094,2177,2578,
2240,2697,2731,3243,2353,2781,2902,3360,2990,346
4,3687,4
113,1021,1434,1548,1947,1645,2034,2127,2569,1699
,2141,2204,2661,2275,2727,2823,3322,1826,2257,23
24,2770,
2425,2880,2975,3501,2475,3001,3098,3586,3198,372
7,3809,4487,1927,2378,2450,2917,2585,3030,3113,3
658,271
5,3148,3246,3774,3363,3825,4015,4687,2819,3288,3
403,3925,3451,4076,4162,4862,3674,4208,4304,4826
,4404,50
13,5253,6047,501,708,760,1202,848,1230,1312,1742,
857,1318,1389,1795,1471,1907,1956,2492,980,1396,
1476,19
76,1559,2015,2080,2496,1611,2071,2163,2633,2262,
2711,2750,3239,1005,1541,1622,1986,1721,2099,218
2,2708,1
774,2227,2280,2758,2336,2872,2939,3445,1769,2327
,2388,2861,2472,2986,3048,3597,2593,3127,3204,37
23,3278,
3800,3944,4633,1100,1688,1731,2214,1816,2306,238
3,2838,1867,2413,2446,2971,2528,3077,3144,3710,2
150,250
4,2590,3095,2669,3190,3274,3786,2792,3302,3420,3
913,3517,4071,4175,4794,2298,2649,2765,3229,2857
,3353,34
30,4025,2958,3481,3547,4101,3691,4253,4343,4953,
3105,3684,3736,4307,3790,4411,4277,5066,3972,461
6,4696,5
306,4730,5552,5688,6216,1144,1801,1832,2467,2103
,2545,2605,3123,2222,2625,2681,3215,2788,3315,34
17,4034,
2288,2777,2854,3319,2913,3437,3527,4130,3005,356
0,3652,4226,3781,4328,4479,5099,2487,2876,2935,3
521,304
5,3623,3745,4284,3208,3748,3812,4468,3982,4393,4
662,5321,3345,3892,4059,4619,4132,4723,4811,5475
,4256,48
46,4837,5653,5075,5754,5872,6583,2646,2994,3131,
3758,3308,3822,3939,4525,3424,4028,4083,4705,420
2,4748,4
834,5535,3530,4153,4289,4803,4346,4853,5084,5765
,4517,5134,5227,5902,5391,6086,6193,6974,3713,43
15,4452,
5093,4653,5108,5356,5950,4682,5330,5492,6152,561
9,6294,6496,7280,4751,5561,5729,6364,5822,6530,6
435,738
6,6024,6687,6795,7689,7030,7858,8067,8636,594,79
0,876,1272,946,1402,1482,1937,996,1506,1565,1971,
1639,20
61,2086,2684,1013,1628,1683,2057,1737,2311,2357,
2815,1872,2362,2463,2960,2541,3055,3138,3770,102
9,1715,1
805,2332,1882,2455,2512,3023,1942,2566,2618,3156
,2692,3257,3336,3832,2005,2656,2743,3298,2841,34
07,3470,
4001,2883,3447,3567,4145,3583,4223,4322,5271,133
1,1877,1922,2533,1981,2621,2688,3226,2117,2754,2
796,338
0,2898,3491,3557,4047,2209,2812,2932,3461,3015,3
577,3606,4184,3092,3612,3649,4333,3888,4420,4586
,5327,22
93,3013,3066,3638,3180,3739,3761,4372,3270,3878,
3956,4514,4098,4642,4710,5501,3376,4013,4141,471
6,4266,4
785,4972,5628,4446,4995,5143,5776,5235,5934,6106
,6944,1358,1966,2066,2735,2195,2800,2909,3508,22
67,2947,
3026,3619,3109,3671,3698,4354,2408,3074,3176,370
3,3264,3860,3935,4490,3366,3987,4089,4676,4190,4
759,489
7,5509,2516,3222,3333,3951,3478,4068,4056,4768,3
538,4160,4215,4868,4381,4980,5045,5794,3662,4271
,4431,50
22,4499,5185,5244,5958,4607,5315,5426,6160,5646,
6317,6508,7296,2602,3394,3487,4172,3599,4243,438
5,5004,3
848,4441,4547,5212,4563,5262,5372,6072,3897,4552
,4599,5347,4774,5417,5588,6286,4932,5636,5719,63

73,5862,
6600,6725,7440,3994,4817,4885,5518,5048,5663,574 6,6460,5152,5843,5973,6678,6121,6812,6999,7752,5 443,599
4,6173,6857,6342,7060,7147,8020,6474,7226,7369,8 140,7575,8344,8603,9426,1464,2122,2231,2950,2391 ,3059,31
58,3797,2442,3194,3292,3872,3387,3970,4120,4906, 2573,3343,3504,4040,3573,4238,4195,4950,3629,429 5,4402,5
125,4534,5194,5287,6033,2849,3544,3636,4235,3844 ,4367,4458,5221,3869,4537,4581,5297,4650,5382,54 69,6239,
3904,4627,4739,5460,4923,5579,5697,6388,5028,581 4,5854,6609,5982,6742,6896,7649,2891,3838,3857,4 506,391
0,4561,4667,5408,4003,4782,4877,5544,4986,5671,5 833,6561,4423,4917,5057,5711,5158,5910,6002,6701 ,5400,60
16,6183,6865,6351,7048,7131,7996,4572,5176,5337, 5920,5452,6137,6261,6928,5611,6302,6413,7115,654 7,7243,7
425,8215,5737,6482,6640,7352,6788,7480,7639,8400 ,6958,7711,7836,8546,7950,8814,8879,9976,2921,39 22,3960,
4888,4361,4961,5036,5803,4470,5117,5203,5942,536 5,6063,6224,6913,4592,5280,5434,6094,5527,6272,6 421,709
5,5680,6522,6398,7195,6718,7403,7560,8291,4941,5 483,5571,6329,5786,6447,6623,7313,5894,6647,6770 ,7497,68
81,7598,7773,8516,6129,6827,6988,7672,7162,7882, 7972,8739,7265,8115,8193,8964,8370,9084,9178,974 4,5167,5
602,5884,6662,6055,6756,6841,7616,6204,7017,7078 ,7818,7210,7904,8165,8845,6247,7178,7330,8093,75 37,8238,
8264,9128,7734,8430,8484,9224,8675,9490,9605,104 88,6569,7463,7520,8315,7797,8454,8579,9324,7928, 8708,87
72,9547,9004,9673,10063,10785,8044,8921,9041,981 8,9269,9888,10151,10958,9378,10255,10364,11179,1 0619,11
446,11830,12437,304,719,963,1512,1121,1582,1763, 2285,1238,1705,1861,2405,1995,2537,2581,3339,134 5,1821,1
912,2508,2113,2653,2845,3401,2217,2827,2747,3498 ,3034,3603,3678,4331,1439,2038,2187,2700,2249,28 08,2928,
3524,2430,2998,3070,3616,3267,3765,3828,4476,255 7,3102,3312,3806,3384,3906,4010,4575,3485,4030,4 135,477
1,4187,4856,5016,5800,1649,2075,2340,2979,2458,3 051,3250,3707,2609,3329,3119,3841,3441,3941,4074 ,4639,27
85,3294,3468,4018,3551,4105,4180,4823,3656,4210, 4349,4944,4463,5072,5191,6041,2964,3511,3632,416 8,3777,4
268,4417,5042,3882,4428,4569,5137,4656,5300,5420 ,6244,4049,4622,4797,5344,4843,5429,5585,6406,49 92,5633,
5760,6535,5880,6654,6851,7808,1951,2314,2484,328 4,2676,3374,3411,4062,2869,3457,3564,4157,3669,4 261,430
2,5034,3019,3580,3694,4279,3816,4407,4541,5155,3 929,4549,4630,5259,4814,5394,5551,6346,3152,3743 ,3894,44
55,3953,4558,4685,5353,4147,4779,4849,5446,4983, 5625,5716,6527,4292,4920,5054,5667,5146,5848,589 7,6633,5
309,5971,6145,6802,6276,6949,7254,7812,3218,3920 ,4093,4707,4250,4829,4975,5650,4340,5001,5087,57 90,5197,
5887,6039,6751,4522,5164,5268,5957,5437,6114,625 7,6994,5515,6289,6432,7120,6575,7308,7420,8269,4 673,536
2,5472,6168,5677,6337,6455,7215,5873,6503,6642,7 375,6807,7446,7695,8498,6028,6697,6862,7581,6933 ,7767,78
76,8685,7237,7932,8050,8648,8175,8841,9091,9917, 2155,2630,2724,3540,2887,3593,3720,4396,2906,372 9,3853,4
482,3979,4645,4719,5532,3134,3862,3984,4742,4117 ,4805,4900,5541,4199,4894,5025,5751,5173,5865,59 24,6628,
3184,4086,4217,4762,4370,4929,5063,5857,4444,512 2,5206,5936,5291,6101,6201,6919,4434,5274,5375,6 091,550
7,6267,6359,7126,5694,6469,6580,7302,6692,7414,7 604,8434,3356,4320,4378,5105,4511,5241,5369,6049 ,4583,54 11,5463,6252,5593,6401,6494, 7285,5007 ,5558,5685,6426,5808,6556,6681,
7392,5987 ,6723,6888, 7566, 7022, 7763, 7 894,8617,5232,5775,5947,6619,6083,6790,6901,7701 ,6231,6969,7066,7803,7259,7984,8097,8784,6440,72 48,7319,
8054,7397,8181,8016,8902,7641,8410,8502,9143,854 0,9410,9557,10093,3428,4493,4528,5498,4938,5616, 5708,64
64,5114,5743,5817,6595,5979,6737,6876,7716,5215, 5965,6078,6746,6165,6908,7035,7830,6301,7084,720 6,7956,7
380,8081,8256,8934,5524,6109,6196,7024,6356,7167 ,7335,8026,6588,7341,7431,8244,7645,8159,8468,91 56,6781,
7531,7746,8418,7842,8536,8627,9329,7990,8666,866 0,9513,8906,9624,9735,10453,5768,6281,6479,7347, 6732,74
35,7593,8309,6894,7707,7779,8510,7922,8560,8656, 9392,7040,7864,8032,8623,8103,8681,8915,9633,830 5,8970,9
063,9770,9238,9954,10073,10836,7291,8060,8228,89 30,8460,8942,9202,9825,8492,9171,9347,10023,9474 ,10173,
10377,11116,8564,9419,9589,10234,9690,10408,103 12,11227,9898,10560,10669,11513,10889,11666,118

74,12402,
2375,2761,2943,3642,3084,3876,3997,4693,3170,404
4,4125,4736,4241,4874,4912,5825,3201,4228,4310,4
865,439
1,5250,5318,6018,4596,5334,5489,6233,5608,6371,6
487,7363,3232,4357,4503,5283,4610,5481,5568,6322
,4699,56
42,5726,6513,5840,6659,6767,7452,4791,5782,5916,
6711,6060,6871,6952,7666,6122,6920,7089,7854,710
9,7944,8
073,9106,3754,4605,4665,5596,4753,5733,5832,6614
,4958,5928,5995,6832,6143,6985,7071,7728,5096,60
10,6188,
6938,6314,7102,7142,7898,6415,7151,7200,8087,752
6,8189,8380,9165,5224,6309,6384,7189,6551,7324,7
358,813
2,6673,7514,7622,8299,7791,8442,8522,9356,6821,7
683,7848,8528,8004,8609,8799,9481,8221,8826,8977
,9640,90
69,9799,9984,10810,3793,4728,4880,5905,5078,6005
,6157,7010,5182,6211,6331,7157,6448,7232,7270,81
09,5401,
6393,6542,7276,6668,7492,7587,8273,6816,7654,778
5,8478,7910,8570,8726,9360,5575,6602,6762,7610,6
963,775
7,7740,8585,7053,7870,7938,8693,8146,8805,8875,9
659,7221,8010,8203,8851,8279,9019,9078,9835,8404
,9152,92
78,10033,9508,10194,10385,11134,5702,6846,6979,7
888,7136,7978,8152,8833,7474,8209,8334,9047,8358
,9097,9
216,9944,7543,8340,8394,9193,8591,9262,9449,1016
3,8759,9499,9580,10245,9725,10464,10595,11276,76
60,8642 ,8714,9369,8887,9522,9615,10332,8985,970
9,9845,10546,9993,10680,10864,11571,9293,9862,10
040,10718,10214 ,10915,11002,11809,10343,11072,1
1209,11936,11393,12132,12371,13148,3965,4966,51
28,6219,5385,6379,6516,7
408,5455,6564,6706,7509,6837,7633,7824,8732,5660
,6776,7004,7722,7100,7968,7916,8780,7173,8038,81
69,8957,
8320,9028,9119,9910,6070,7058,7184,7962,7469,812
6,8234,9056,7503,8326,8374,9134,8448,9233,9315,1
0110,75
49,8424,8554,9307,8751,9442,9566,10268,8860,9683
,9718,10477,9852,10606,10757,11478,6132,7457,748
6,8285,
7554,8350,8472,9255,7678,8599,8699,9401,8818,953
1,9699,10432,8199,8747,8894,9570,8992,9780,9871,
10571,9
246,9878,10050,10732,10224,10904,10987,11786,83
64,9013,9187,9787,9300,10016,10133,10796,9465,10
183,102
88,10973,10419,11087,11257,12007,9598,10353,105
12,11197,10655,11306,11459,12183,10824,11532,11
649,1231
8,11745,12592,12661,13610,6180,7570,7627,8718,81
22,8793,8866,9666,8250,8949,9032,9809,9211,9937,
10103,1
0771,8388,9115,9284,9966,9387,10140,10299,10947,
9538,10398,10275,11043,10584,11242,11374,12078,
8766,93
38,9433,10204,9650,10319,10498,11149,9761,10525,
10641,11325,10746,11409,11590,12288,10003,10693
,10850,
11494,11016,11685,11765,12524,11104,11919,11986
,12732,12154,12842,12925,13422,9000,9458,9751,10
536,992
7,10633,10707,11428,10080,10875,10929,11626,110
60,11709,11961,12624,10120,11031,11164,11895,11
356,1203
2,12056,12886,11552,12205,12261,12965,12464,132
00,13302,14035,10442,11291,11340,12107,11607,12
235,1234
8,13056,11725,12496,12560,13253,12770,13361,136
87,14259,11850,12698,12804,13478,13015,13546,13
766,1439
3,13102,13841,13936,14552,14138,14741,14990,153
72,324,780,1068,1727,1257,1811,2089,2672,1408,20
24,2200,
2804,2349,2954,3009,3885,1530,2146,2254,2924,247
9,3117,3325,3963,2597,3304,3212,4064,3534,4193,4
274,499
8,1634,2396,2561,3166,2637,3282,3414,4095,2834,3
494,3570,4205,3802,4364,4438,5170,2983,3610,3850
,4414,39
32,4520,4636,5286,4052,4659,4777,5512,4840,5613,
5789,6578,1887,2438,2738,3474,2865,3553,3784,429
7,3038,3
866,3645,4449,4006,4566,4713,5359,3260,3834,4037
,4647,4123,4745,4832,5572,4248,4859,5031,5705,51
61,5846,
5968,6823,3454,4081,4220,4820,4388,4935,5102,581
1,4496,5111,5277,5913,5388,6089,6199,7019,4690,5
341,554
8,6117,5599,6208,6363,7180,5757,6410,6539,7309,6
655,7422,7618,8583,2301,2704,2895,3818,3141,3916
,3975,47
02,3349,4022,4138,4808,4259,4926,4969,5805,3514,
4150,4286,4947,4425,5090,5247,5931,4555,5256,535
0,6044,5
565,6171,6326,7122,3681,4336,4508,5149,4578,5265
,5414,6125,4788,5531,5605,6228,5748,6405,6499,72
98,4956,
5682,5819,6443,5923,6624,6676,7405,6098,6748,692
4,7568,7049,7720,8034,8587,3752,4531,4733,5440,4
903,558
2,5740,6430,5010,5762,5859,6573,5976,6669,6809,7
516,5230,5945,6052,6734,6213,6890,7033,7771,6292
,7069,72
04,7896,7343,8089,8201,9039,5404,6140,6249,6947,
6457,7111,7228,7998,6650,7272,7410,8154,7573,822
3,8464,9
275,6804,7467,7629,8352,7703,8544,8650,9476,8018
,8701,8822,9435,8940,9636,9886,10674,2521,3063,3
187,410

8,3370,4165,4313,5081,3390,4325,4461,5179,4602,5
368,5458,6312,3665,4473,4613,5486,4756,5555,5666
,6321,48
52,5649,5797,6533,5953,6645,6704,7399,3716,4725,
4871,5504,5051,5691,5828,6636,5140,5899,5984,671
4,6075,6
880,6978,7691,5131,6059,6153,6869,6284,7044,7133
,7908,6472,7245,7354,8083,7456,8191,8378,9213,39
01,4989,
5060,5876,5209,6021,6148,6828,5303,6191,6241,702
8,6368,7175,7267,8069,5771,6334,6465,7197,6587,7
332,745
0,8173,6765,7490,7658,8336,7793,8532,8664,9399,6
013,6552,6728,7388,6860,7556,7676,8476,7003,7742
,7838,85
74,8040,8757,8868,9575,7217,8030,8101,8824,8179,
8951,8789,9694,8414,9191,9286,9939,9327,10191,10
327,108
33,3991,5188,5238,6277,5699,6396,6486,7239,5891,
6518,6597,7365,6760,7507,7652,8490,5999,6739,685
5,7512,6
940,7679,7810,8607,7075,7856,7986,8724,8167,8849
,9030,9730,6306,6885,6972,7799,7127,7948,8118,87
97,7360, 8124,8207,9015,8422,8928,9244,9956,
7551,8307 ,8520,9196,8611,9318,9415,10
115,8764,9456,9446, 10291,970 1, 1
0392,10504,11176,6544,7055,7250,8136,7495,8217,8
366,9086,7664,8482,8548,9295,8697,9345,9444,1017
6,7816,
8634,8801,9408,8870,9467,9711,10400,9076,9763,98
59,10533,10025,10713,10813,11523,8075,8835,8996,
9720,92
35,9737,9991,10581,9266,9964,10130,10774,10257,1
0909,11098,11789,9349,10199,10366,10976,10458,1
1128,11
040,11878,10652,11270,11368,12136,11574,12276,1
2453,12934,2774,3236,3434,4232,3590,4484,4625,54
23,3700,
4670,4765,5478,4891,5630,5674,6605,3732,4882,497
8,5622,5069,6029,6103,6798,5312,6112,6269,7008,6
389,714
4,7261,8150,3768,5039,5200,6067,5331,6256,6347,7
096,5430,6423,6504,7287,6618,7427,7533,8230,5538
,6566,66
90,7484,6835,7635,7732,8446,6899,7697,7868,8625,
7890,8722,8843,9903,4351,5324,5397,6376,5495,651
1,6611,7
382,5722,6709,6774,7597,6915,7759,7850,8506,5868
,6793,6965,7714,7086,7878,7924,8673,7191,7930,79
82,8858,
8301,8960,9158,9961,6007,7080,7158,7970,7321,810
7,8138,8904,7444,8293,8392,9071,8568,9222,9304,1
0138,75
91,8462,8619,9309,8774,9390,9591,10265,8994,9617
,9773,10413,9869,10565,10729,11497,4399,5466,563
9,6683,
5851,6779,6935,7783,5961,6992,7106,7942,7223,801
2,8052,8883,6185,7169,7315,8058,7433,8266,8362,9
043,757
9,8432,8556,9264,8683,9358,9515,10148,6354,7377,
7528,8382,7738,8530,8514,9367,7822,8644,8710,948
5,8913,9
601,9671,10429,8002,8782,8974,9645,9052,9813,987
6,10590,9182,9949,10060,10782,10283,10932,11107,
11799,6
477,7612,7754,8658,7914,8749,8919,9626,8252,8983
,9108,9840,9132,9895,10008,10699,8319,9117,9174,
9981,93
76,10053,10227,10898,9552,10273,10358,10981,104
96, 11188, 11303, 11923,8438,9424,950 1, 10
156,9676, 1030 1, 10
382,11063,9782,10480,10603,11260,10743,11381,11
545,12187,10078,10622,10793,11421,10952,11600,1
1672,124
14,11078,11742,11860,12512,12035,12686,12908,13
568,4589,5730,5908,6997,6163,7153,7293,8187,6236
,7337,74
73,8283,7608,8408,8595,9524,6438,7545,7777,8494,
7874,8741,8689,9568,7952,8809,8938,9756,9095,982
3,9922,1
0660,6849,7834,7964,8735,8248,8896,9007,9849,827
7,9099,9147,9930,9231,10018,10105,10855,8322,920
4,9336,
10095,9543,10219,10335,10996,9652,10448,10485,1
1200,10614,11319,11456,12100,6910,8236,8262,906
0,8330,9
126,9253,10045,8452,9383,9492,10181,9610,10306,1
0469,11155,8966,9533,9685,10348,9792,10544,1062
8,11282,
10035,10644,10805,11431,10961,11587,11659,12394
,9139,9806,9971,10552,10088,10763,10878,11484,10
250,109
18,11019,11643,11140,11755,11909,12576,10374,11
084,11224,11847,11359,11954,12085,12736,11510,1
2150,122
57,12860,12356,13078,13134,13973,6954,8348,8396,
9504,8892,9582,9661,10440,9022,9746,9833,10573,9
998,106
91,10844,11469,9163,9912,10068,10721,10166,1088
7,11025,11629,10317,11122,11005,11715,11297,118
88,12021,
12645,9559,10123,10209,10938,10424,11048,11212,
11816,10528,11233,11346,11968,11440,12049,12202
,12834,1
0752,11396,11539,12118,11689,12299,12375,13024,
11776,12492,12556,13205,12711,13297,13376,13806
,9797,10
240,10517,11248,10682,11331,11406,12067,10827,1
1561,11613,12243,11729,12314,12532,13111,10867,
11699,11
826,12472,12000,12600,12616,13336,12172,12761,1
2808,13406,12970,13621,13704,14328,11161,11943,
11989,12
665,12224,12782,12890,13489,12333,12992,13046,1
3660,13234,13755,14041,14521,12429,13172,13267,
13865,13 447,13912,14099,14640,13530,14177,14245,14776,1
4422,14932,15147,15466,1962,3088,3625,4679,3947,
4800,51
19,5990,4177,5019,5294,6176,5521,6381,6452,7539,
4375,5218,5379,6339,5715,6557,6842,7623,5883,681
8,6695,7
765,7116,7918,8024,8854,4544,5591,5836,6631,5939
,6784,6960,7805,6221,7064,7164,7935,7439,8144,82
26,9024,
6418,7211,7501,8195,7602,8328,8456,9145,7748,848
6,8615,9372,8677,9469,9638,10434,4915,5657,6081,
7039,62
64,7138,7416,8065,6491,7522,7234,8242,7685,8372,
8538,9218,6753,7478,7726,8470,7844,8577,8668,943
0,7992,8
706,8877,9564,9011,9697,9821,10671,7013,7789,795
8,8652,8161,8776,8955,9664,8297,8968,9136,9768,9
242,993
4,10058,10858,8508,9198,9403,9979,9453,10065,102
22,11013,9612,10270,10395,11131,10514,11236,114
15,1223
1,5449,6036,6297,7461,6592,7585,7647,8524,6874,7
709,7862,8640,8006,8768,8816,9657,7091,7884,8046
,8791,82
13,8947,9104,9785,8356,9110,9207,9891,9421,10030
,10189,10955,7282,8111,8313,9002,8386,9123,9273,
9988,86
32,9381,9462,10083,9603,10260,10351,11125,8807,9
536,9678,10304,9775,10482,10530,11221,9942,1060
0,10768,
11371,10892,11504,11762,12239,7371,8342,8562,92
98,8755,9437,9594,10286,8862,9622,9713,10427,983
0,10520,
10663,11328,9080,9794,9900,10587,10075,10738,10
872,11542,10153,10907,11037,11652,11170,11813,1
1902,126
20,9258,9996,10108,10791,10314,10950,11057,1173
2,10509,11101,11230,11864,11377,11926,12139,128
21,10658,
11279,11424,12039,11488,12198,12291,12979,11752
,12337,12441,12947,12544,13106,13307,13930,5779,
6525,66
64,7828,6904,7902,8079,8932,6929,8095,8258,9035,
8416,9227,9313,10168,7256,8271,8426,9340,8593,94
12,9520,
10178,8691,9510,9647,10387,9801,10501,10554,112
18,7326,8552,8716,9363,8898,9545,9687,10493,8987
,9749,98
37,10568,9925,10727,10821,11475,8979,9908,10011,
10715,10145,10884,10970,11656,10330,11069,11173
,11806,1
1273,11898,12060,12766,7562,8837,8911,9732,9067,
987 4,10006,10677 ,9154,10048,10 100, 10870, 10229,
110 10, 11
093,11792,9629,10196,10322,11034,10445,11152,11
267,11881,10617,11300,11450,12024,11564,12194,1
2306,129
16,9864,10411,10579,11206,10710,11362,11462,121
43,10847,11520,11603,12228,11772,12383,12476,13
060,1104
5,11759,11819,12445,11885,12548,12410,13153,120
92,12744,12825,13346,12855,13557,13665,14060,76
70,9050,
9089,10135,9554,10252,10345,11066,9742,10379,10
450,11185,10609,11316,11437,12158,9847,10598,10
702,1132
2,10788,11465,11577,12250,10912,11620,11722,123
60,11867,12460,12612,13181,10161,10735,10816,11
568,1096
7,11692,11833,12417,11182,11840,11912,12604,120
96,12528,12791,13356,11353,11996,12180,12749,12
265,1285
1,12930,13494,12390,12961,12956,13638,13162,137
15,13800,14307,10403,10895,11081,11843,11309,11
916,1204
6,12657,11453,12147,12213,12829,12329,12868,129
52,13541,11581,12280,12421,12921,12480,12974,13
167,1372
1,12653,13210,13282,13824,13427,13961,14048,145
60,11796,12449,12588,13176,12787,13186,13391,13
870,1281
7,13371,13504,14010,13600,14112,14252,14732,128
73,13562,13693,14164,13772,14279,14211,14802,13
918,1437
9,14452,14971,14600,15061,15169,15452,6134,6720,
6983,7976,7186,8287,8440,9282,7304,8500,8601,933
3,8743,
9488,9527,10461,7349,8730,8830,9478,8923,9883,99
52,10649,9167,9969,10125,10853,10242,10978,1109
0,11857,
7393,8885,9058,9915,9185,10118,10206,10935,9289,
10281,10361,11110,10474,11245,11343,11930,9394,
10416,10
549,11294,10688,11434,11507,12114,10749,11481,1
1623,12272,11639,12352,12456,13316,8130,9176,92
49,10237,
9351,10369,10466,11203,9577,10563,10625,11399,1
0765,11536,11610,12165,9723,10638,10807,11491,1
0927,116
36,11669,12310,11022,11679,11719,12468,11993,12
552,12719,13366,9857,10924,10993,11712,11146,11
823,1185
4,12508,11254,11982,12071,12649,12220,12774,128
38,13515,11387,12125,12269,12847,12398,12912,13
069,1360
5,12580,13092,13214,13726,13287,13847,13979,145
36,8183,9320,9497,10538,9706,10636,10777,11558,9
811,108
30,10941,11682,11054,11749,11779,12488,10038,10
999,11137,11782,11251,11964,12042,12628,11384,1
2103,122
17,12800,12322,12881,13006,13520,10211,11194,11
334,12064,11516,12191,12176,12895,11594,12284,1
2344,129
83,12516,13074,13129,13743,11735,12406,12568,13
115,12632,13248,13292,13876,12740,13351,13452,1

4016,136
32,14125,14265,14750,10338,11412,11529,12303,11
662,12379,12520,13097,11950,12572,12678,13272,1
2703,133
12,13401,13955,12003,12682,12728,13386,12899,13
442,13584,14105,13037,13627,13682,14171,13795,1
4314,144
08,14829,12110,12943,12997,13525,13139,13643,13
709,14224,13219,13783,13882,14371,13985,14460,1
4584,150
10,13463,13894,14023,14482,14144,14616,14665,15
136,14231,14707,14793,15203,14903,15309,15439,1
5771,840
2,9587,9758,10838,10021,10990,11113,11891,10090,
11158,11285,11978,11402,12082,12246,13019,10296
,11350,1
1548,12161,11633,12367,12325,13051,11695,12425,
12540,13195,12669,13258,13331,13924,10696,11597
,11702,1
2363,11947,12504,12596,13277,11971,12674,12715,
13341,12778,13417,13483,14073,12010,12757,12864
,13473,1
3033,13578,13671,14184,13120,13760,13789,14321,
13888,14415,14505,14951,10754,11933,11957,12637
,12017,1
2690,12795,13437,12121,12903,12988,13552,13088,
13649,13777,14293,12564,13028,13143,13676,13224
,13829,1
3900,14386,13432,13906,14029,14490,14151,14608,
14657,15125,12707,13243,13381,13835,13468,14004
,14086,1
4528,13594,14118,14197,14648,14286,14715,14820,
15237,13698,14238,14350,14785,14445,14848,14941
,15334,1
4544,14980,15051,15412,15104,15538,15569,15938,
10802,12028,12074,13001,12500,13065,13125,13749
,12608,1
3191,13263,13859,13396,13948,14067,14513,12723,
13326,13457,13967,13536,14092,14204,14632,13654
,14272,1
4191,14690,14400,14811,14894,15273,13042,13499,
13573,14131,13738,14218,14336,14758,13818,14357
,14437,1
4857,14498,14913,15020,15398,13991,14467,14568,
14961,14673,15072,15114,15509,14724,15191,15226
,15600,1
5322,15648,15682,15872,13229,13589,13812,14364,
13942,14430,14475,14922,14054,14592,14624,15041
,14698,1
5082,15214,15553,14080,14681,14767,15180,14884,
15249,15261,15665,15000,15347,15385,15699,15480
,15790,1
5830,16067,14300,14838,14875,15297,15031,15360,
15425,15734,15093,15495,15524,15810,15616,15850
,15962,1
6128,15158,15584,15632,15893,15716,15915,15987,
16161,15753,16012,16039,16196,16096,16235,16277
,16326,1
3,57,106,287,148,316,468,718,187,445,512,783,573,8
59,888,1422,222,490,533,845,630,944,1074,1470,684
,1061,9
98,1545,1203,1625,1685,2199,256,593,667,971,701,1
049,1134,1563,799,1180,1225,1633,1363,1743,1792,
2323,87
4,1247,1403,1775,1451,1862,1938,2410,1536,1953,2
048,2577,2090,2657,2789,3409,344,612,751,1169,81
4,1214,1
352,1702,903,1412,1269,1799,1499,1893,1997,2465,
1036,1383,1526,1946,1581,2019,2083,2623,1668,210
4,2226,2
723,2316,2826,2926,3609,1157,1554,1651,2076,1759
,2159,2278,2805,1847,2284,2404,2884,2483,3017,31
06,3775,
1975,2453,2600,3042,2640,3111,3240,3911,2756,327
2,3382,4020,3475,4114,4283,5110,553,735,830,1373,
958,144
2,1480,1983,1098,1517,1590,2069,1676,2152,2179,2
799,1192,1598,1693,2165,1783,2271,2385,2894,1885
,2392,24
59,2987,2611,3086,3207,3863,1290,1726,1855,2310,
1901,2398,2501,3047,2055,2588,2645,3125,2751,326
8,3346,4
008,2172,2707,2810,3305,2889,3449,3488,4103,3027
,3549,3697,4240,3803,4362,4624,5113,1332,1870,20
12,2518,
2138,2628,2745,3291,2206,2767,2842,3404,2931,348
4,3601,4196,2367,2910,2992,3536,3116,3668,3783,4
408,317
8,3815,3930,4505,4050,4668,4763,5536,2495,3062,3
149,3714,3314,3851,3950,4591,3471,3989,4107,4724
,4244,47
83,5002,5761,3596,4155,4294,4899,4348,5074,5171,
5954,4608,5222,5332,5914,5445,6110,6358,7163,649
,917,985 ,1572,1110,1607,1710,2265,1122,1718,1815
,2329,1916,2471,2536,3197,1280,1823,1923,2560,20
26,2606,2690,320
2,2097,2679,2794,3373,2915,3467,3515,4099,1311,2
004,2111,2571,2239,2712,2816,3462,2304,2874,2936
,3523,30
07,3660,3742,4341,2297,2997,3072,3647,3173,3799,
3871,4519,3323,3966,4058,4664,4144,4754,4921,570
1,1432,2
192,2252,2853,2354,2972,3067,3617,2422,3101,3145
,3779,3244,3907,3985,4651,2778,3211,3318,3927,34
13,4042,
4140,4740,3562,4174,4312,4886,4426,5064,5183,587
9,2956,3391,3532,4088,3643,4233,4323,5012,3763,4
383,446
0,5101,4628,5273,5376,6048,3938,4621,4681,5335,4
744,5451,5299,6166,4952,5681,5772,6412,5810,6663
,6801,73
31,1489,2335,2373,3169,2718,3263,3337,3962,2863,
3359,3427,4069,3558,4189,4309,5024,2946,3545,363
9,4192,3
709,4334,4436,5132,3819,4478,4584,5243,4731,5358
,5528,6200,3192,3664,3734,4429,3867,4550,4691,53

08,4061,
4694,4770,5513,4965,5431,5731,6427,4225,4860,505
2,5684,5135,5799,5898,6584,5276,5935,5927,6766,6
174,686
8,6987,7696,3386,3807,3969,4708,4181,4780,4914,5
578,4316,5018,5080,5780,5216,5829,5922,6646,4443
,5159,53
14,5888,5378,5946,6184,6879,5570,6235,6330,7018,
6497,7203,7310,8076,4654,5343,5496,6192,5723,620
7,6463,7
065,5755,6436,6601,7266,6731,7409,7609,8383,5831
,6672,6840,7479,6937,7642,7548,8491,7139,7796,79
03,8798,
8131,8965,9170,9752,768,1024,1146,1659,1236,1831
,1931,2507,1301,1961,2040,2554,2131,2668,2696,34
31,1322,
2118,2186,2662,2258,2977,3032,3592,2428,3037,316
4,3767,3258,3879,3977,4721,1342,2232,2342,3002,2
441,315
4,3225,3840,2513,3286,3350,4000,3444,4118,4214,4
789,2594,3400,3506,4166,3622,4298,4373,4984,3672
,4344,44
85,5150,4502,5240,5349,6375,1735,2435,2489,3249,
2565,3355,3436,4080,2734,3519,3571,4265,3693,439
4,4471,5
037,2847,3588,3730,4359,3831,4495,4529,5195,3923
,4536,4580,5364,4857,5462,5648,6431,2951,3827,38
91,4567,
4027,4684,4711,5407,4137,4844,4933,5567,5098,570
9,5785,6610,4262,4999,5147,5793,5288,5869,6066,6
740,549
1,6092,6245,6891,6340,7047,7222,8047,1767,2548,2
674,3493,2831,3575,3705,4415,2920,3751,3843,4546
,3942,46
04,4634,5387,3096,3903,4023,4644,4129,4822,4911,
5539,4247,4971,5086,5747,5201,5842,5993,6620,323
0,4077,4
207,4927,4380,5061,5049,5850,4450,5165,5228,5962
,5419,6077,6144,6907,4594,5293,5474,6120,5550,62
88,6348,
7074,5670,6419,6534,7275,6757,7432,7621,8401,333
2,4280,4390,5180,4523,5264,5422,6100,4809,5485,5
604,631
5,5623,6365,6480,7187,4867,5609,5662,6453,5855,6
524,6698,7402,6027,6747,6833,7487,6977,7712,7835
,8549,49
77,5903,5980,6629,6146,6775,6859,7574,6255,6957,
7088,7788,7236,7919,8102,8859,6550,7108,7290,796
3,7458,8
160,8249,9125,7588,8331,8475,9243,8684,9452,9717
,10545,1908,2740,2879,3755,3076,3883,4004,4750,3
135,404
6,4159,4838,4273,4949,5123,6001,3295,4222,4412,5
030,4492,5255,5207,6045,4557,5320,5442,6227,5590
,6298,63
92,7148,3634,4457,4564,5252,4806,5402,5505,6323,
4835,5592,5643,6402,5720,6490,6579,7353,4873,569
2,5818,6
570,6017,6691,6810,7502,6126,6927,6968,7721,7097
,7851,8001,8758,3680,4799,4819,5556,4883,5618,57
39,6517,
4987,5866,5970,6656,6082,6782,6948,7673,5465,601
2,6156,6824,6260,7025,7117,7811,6507,7130,7297,7
971,746
6,8147,8233,9100,5632,6278,6444,7034,6560,7253,7
376,8031,6722,7417,7527,8216,7659,8347,8531,9319
,6850,75
96,7749,8457,7895,8588,8746,9509,8061,8819,8944,
9660,9055,9929,9997,11085,3718,4895,4940,5983,53
93,6058,
6136,6916,5516,6217,6305,7056,6471,7179,7340,801
7,5654,6385,6543,7209,6637,7387,7536,8196,6792,7
634,751
3,8298,7827,8509,8669,9397,6035,6594,6682,7443,6
900,7559,7733,8417,7009,7758,7879,8606,7987,8707
,8882,96
28,7244,7933,8090,8781,8263,8988,9077,9855,8369,
9217,9296,10081,9477,10202,10298,10857,6270,671
5,7000,7
772,7170,7865,7947,8725,7320,8117,8178,8927,8312
,9010,9265,9963,7361,8282,8435,9195,8645,9344,93
68,1024
8,8842,9539,9595,10344,9790,10608,10722,11573,76
82,8573,8628,9422,8905,9563,9693,10443,9033,9824
,9889,1
0665,10124,10789,11169,11838,9148,10039,10160,1
0930,10389,11000,11256,11994,10497,11357,11461,
12189,11
691,12422,12755,13268,371,931,1258,1968,1461,206
2,2291,2941,1616,2212,2416,3091,2583,3254,3309,4
218,175
1,2360,2477,3216,2729,3395,3630,4287,2858,3605,3
510,4401,3855,4526,4614,5361,1878,2634,2821,3453
,2900,35
84,3726,4433,3120,3811,3899,4540,4133,4714,4786,
5525,3277,3934,4185,4760,4269,4876,4996,5634,438
7,5021,5
138,5853,5198,5949,6113,6914,2145,2685,3012,3787
,3159,3875,4111,4648,3341,4203,3958,4802,4337,49
18,5071,
5706,3554,4163,4369,5006,4464,5104,5192,5911,458
7,5225,5381,6038,5511,6172,6293,7156,3771,4419,4
560,517
7,4727,5290,5456,6141,4847,5471,5629,6240,5725,6
404,6529,7359,5040,5687,5882,6451,5933,6536,6696
,7521,60
90,6745,6873,7648,6993,7764,7957,8916,2530,2982,
3188,4152,3422,4258,4301,5055,3655,4355,4481,516
2,4601,5
282,5326,6131,3835,4498,4631,5302,4773,5448,5595
,6258,4902,5606,5698,6362,5901,6502,6660,7460,39
96,4688,
4864,5502,4930,5615,5758,6458,5153,5863,5938,655
5,6079,6736,6829,7640,5317,6014,6154,6780,6248,6
962,701
1,7745,6414,7085,7262,7909,7389,8053,8359,8922,4

073,4892,5089,5783,5270,5917,6069,6764,5370,6097,6187,6905,6300,7002,7154,7859,5576,6265,6372,7072,6546,7229,7374,8096,6625,7404,7546,8220,7688,8413,8527,9375,5745,6468,6582,7284,6789,7451,7567,8318,6989,7615,7753,8481,7913,8555,8804,9609,7143,7806,7967,8690,8037,8876,8982,9802,8341,9038,9153,9762,9276,9958,10212,11029,2783,3364,3480,4453,3676,4516,4661,5433,3701,4671,4815,5530,4959,5712,5796,6644,3973,4828,4968,5820,5120,5890,5996,6651,5210,5988,6123,6866,6275,6980,7041,7739,4031,5083,5231,5845,5405,6022,6161,6971,5488,6222,6308,7052,6397,7216,7318,8023,5476,6377,6483,7207,6617,7381,7475,8227,6806,7582,7692,8407,7802,8521,8713,9544,4236,5346,5413,6205,5564,6345,6478,7165,5645,6519,6572,7368,6705,7515,7607,8389,6105,6670,6799,7540,6923,7667,7790,8497,7103,7833,7993,8674,8123,8871,8999,9731,6335,6889,7063,7731,7198,7897,8007,8810,7346,8072,8166,8910,8365,9088,9201,9902,7555,8353,8423,9159,8503,9283,9120,10020,8750,9519,9614,10262,9653,10527,10673,11199,4319,5545,5584,6608,6032,6729,6822,7576,6215,6856,6932,7706,7094,7845,7981,8825,6318,7081,7194,7853,7281,8011,8137,8939,7415,8182,8310,9061,8487,9184,9361,10054,6634,7225,7312,8125,7470,8270,8441,9131,7700,8447,8537,9350,8752,9259,9578,10276,7889,8639,8853,9528,8948,9648,9743,10449,9094,9783,9776,10631,10026,10739,10849,11541,6882,7396,7592,8451,7841,8543,8702,9416,7999,8815,8888,9623,9027,9674,9771,10511,8143,8971,9137,9738,9206,9796,10034,10748,9411,10091,10184,10883,10357,11064,11178,11886,8395,9164,9332,10047,9569,10062,10321,10939,9604,10290,10465,11132,10591,11277,11473,12134,9679,10537,10705,11336,10806,11499,11410,12232,11009,11637,11734,12481,11932,12614,12792,13240,3052,3528,3746,4570,3915,4841,4981,5766,4016,5033,5129,5815,5258,5967,6004,6939,4054,5246,5338,5956,5428,6355,6424,7134,5659,6441,6598,7348,6719,7485,7601,8469,4092,5390,5553,6387,5673,6589,6679,7438,5774,6754,6838,7626,6955,7770,7875,8561,5877,6895,7032,7821,7176,7977,8055,8775,7238,8025,8188,8959,8210,9049,9175,10225,4701,5668,5736,6707,5834,6847,6946,7725,6053,7043,7112,7937,7257,8088,8172,8836,6197,7125,7303,8041,7430,8204,8245,9005,7529,8253,8304,9190,8633,9290,9489,10284,6328,7424,7498,8292,7663,8429,8463,9234,7782,8622,8731,9405,8899,9553,9634,10475,7927,8792,8954,9639,9109,9722,9916,10599,9325,9945,10096,10756,10188,10913,11094,11862,4747,5807,5972,7020,6177,7119,7273,8112,6285,7325,7447,8259,7563,8335,8375,9212,6509,7506,7655,8381,7778,8600,8696,9380,7921,8763,8893,9590,9016,9684,9843,10479,6686,7715,7871,8719,8066,8865,8848,9698,8153,8976,9044,9810,9248,9921,9992,10773,8325,9114,9306,9970,9386,10137,10197,10948,9514,10271,10397,11141,10624,11298,11479,12149,6815,7951,8082,8993,8239,9083,9254,9950,8582,9314,9441,10165,9466,10216,10336,11055,8651,9447,9503,10313,9703,10380,10567,11268,9877,10616,10697,11348,10840,11550,11668,12274,8769,9757,9829,10487,10005,10639,10731,11432,10104,10823,10956,11625,11102,11746,11908,12531,10412,10974,11150,11780,11318,11956,12033,12735,11441,12095,12216,12846,12376,13011,13215,13860,4946,6061,6230,7333,6492,7494,7630,8515,6562,7675,7817,8618,7943,8740,8933,9850,6771,7883,8108,8831,8202,9072,9021,9897,8276,9142,9270,10076,9427,10146,10239,11020,7185,8158,8288,9066,8576,9228,9337,10174,8612,9432,9484,10253,9558,10352,10435,11217,8657,9534,9667,10426,9868,10559,10683,11369,9978,10797,10832,11562,10965,11680,11815,12450,7247,8567,8594,9391,8663,9457,9583,10375,8786,9712,9815,10519,9936,10648,10814,11522,9301,9863,10012,10687,10109,10893,10983,11648,10367,10991,11157,11793,11327,11944,12018,12717,9471,10132,10307,10900,10420,11123,11238,11851,10582,11287,11389,12006,11511,12108,12259,12906,10714,11452,11593,12204,11723,12301,12434,13055,11873,12497,12598,13169,12681,13398,13456,14234,7294,8678,8736,9834,9223,9911,9983,10783,9355,10067,10152,10922,10329,11047,11208,11827,9496,10233,10402,11076,10505,11247,11398,11983,10656,11490,11378,12069,11660,12244,12359,12967,9882,10457,10551,11307,10766,11419,11582,12162,10876,11605,11711,12316,11804,12391,12 547,13145,11111,11757,11897,12465,12044,12630,1
2700,13343,12123,12831,12887,13516,13031,13607,
13677,14
078,10117,10577,10866,11617,11038,11703,11768,1
2405,11187,11921,11967,12578,12083,12648,12867,
13426,11
226,12057,12177,12811,12345,12927,12948,13641,1
2515,13076,13121,13708,13293,13901,13984,14569,
11531,12
286,12328,12990,12562,13100,13194,13782,12664,1
3318,13373,13943,13547,14031,14295,14745,12772,
13486,13
576,14127,13747,14180,14355,14849,13819,14418,1
4492,14976,14653,15119,15308,15594,396,1011,139
3,2245,1
642,2348,2701,3418,1839,2617,2837,3579,3022,3759
,3823,4851,1990,2773,2905,3722,3183,3954,4200,49
43,3328,
4178,4065,5058,4447,5204,5296,6095,2124,3081,328
1,4012,3377,4148,4305,5095,3613,4397,4488,5219,4
757,539
9,5482,6273,3791,4533,4812,5454,4905,5573,5703,6
390,5046,5728,5861,6622,5930,6724,6902,7690,2447
,3130,34
97,4376,3651,4467,4737,5323,3859,4831,4574,5494,
4993,5626,5791,6466,4122,4793,5027,5717,5126,582
6,5919,6
684,5267,5951,6128,6817,6263,6959,7083,7929,4352
,5077,5234,5906,5425,6030,6202,6925,5547,6212,63
82,7029,
6495,7205,7314,8119,5764,6446,6658,7233,6710,732
3,7477,8284,6870,7523,7651,8415,7766,8529,8727,9
695,296
1,3458,3689,4776,3981,4889,4955,5777,4229,5009,5
144,5895,5279,6019,6064,6918,4422,5156,5311,6043
,5468,61
89,6350,7045,5612,6360,6456,7159,6674,7286,7441,
8224,4618,5367,5559,6250,5637,6370,6521,7242,587
1,6639,6
717,7342,6861,7519,7613,8403,6051,6794,6934,7557
,7036,7737,7786,8511,7214,7857,8029,8676,8151,88
29,9140,
9702,4698,5587,5812,6548,5998,6693,6854,7544,610
8,6877,6973,7684,7092,7780,7917,8626,6333,7061,7
168,784
3,7329,7995,8133,8878,7406,8168,8306,9003,8449,9
194,9305,10157,6512,7255,7366,8051,7571,8212,833
3,9103,7
762,8379,8517,9257,8682,9326,9576,10394,7911,857
5,8738,9461,8811,9656,9765,10594,9124,9819,9938,
10553,1
0059,10751,10997,11740,3235,3887,4035,5107,4254,
5174,5340,6182,4276,5355,5508,6280,5665,6473,656
7,7426,
4597,5522,5679,6596,5837,6667,6778,7434,5941,675
9,6912,7646,7068,7756,7813,8507,4658,5802,5964,6
613,615
1,6803,6943,7747,6243,7014,7099,7825,7190,7985,8
080,8800,6232,7174,7271,7973,7398,8145,8235,9014
,7584,83
51,8461,9186,8563,9294,9486,10333,4870,6084,6159
,6991,6313,7137,7264,7936,6409,7305,7357,8129,74
83,8278,
8373,9173,6884,7449,7580,8302,7698,8437,8557,927
4,7873,8596,8767,9445,8901,9644,9779,10516,7128,
7665,78
37,8495,7965,8665,8783,9586,8104,8852,8946,9688,
9146,9873,9987,10690,8321,9135,9205,9941,9279,10
071,990
6,10809,9523,10310,10406,11050,10446,11295,1142
6,11882,4974,6290,6343,7394,6813,7510,7599,8345,
7005,763
2,7708,8471,7867,8614,8761,9600,7114,7849,7959,8
620,8045,8788,8918,9721,8174,8963,9092,9841,9268
,9967,10
149,10843,7421,7989,8074,8907,8231,9053,9221,991
3,8467,9226,9310,10136,9530,10046,10363,11067,86
59,9413 ,9632,10315,9726,10438,10534,11220,9880,
10574,10566,11392,10817,11485,11588,12185,7657,
8155,8355,9237,8
602,9321,9475,10205,8773,9592,9662,10414,9812,10
462,10562,11280,8924,9748,9919,10526,9989,10585,
10826,1
1493,10193,10877,10971,11614,11135,11774,11865,
12490,9179,9953,10116,10834,10355,10852,11099,1
1657,103
86,11073,11235,11829,11360,11951,12116,12720,10
468,11304,11464,12009,11544,12144,12065,12794,1
1720,122
67,12354,13014,12534,13135,13283,13684,3541,409
6,4327,5249,4512,5533,5690,6531,4638,5742,5847,6
586,5985 ,6743,6787,7717,4678,5978,6074,6733,616
9,7145,7218,7905,6417,7227,7385,8110,7504,8247,8
367,9252,4717,613
8,6303,7183,6439,7370,7462,8198,6538,7538,7617,8
393,7729,8535,8643,9335,6648,7677,7798,8592,7941
,8744,88
40,9556,8003,8806,8975,9740,8997,9838,9962,11015
,5384,6429,6505,7489,6606,7624,7723,8489,6836,78
19,7881,
8703,8019,8869,8958,9618,6982,7899,8068,8823,818
6,8986,9031,9788,8296,9036,9087,9975,9407,10079,
10279,1
1070,7123,8180,8261,9075,8427,9210,9241,10022,85
51,9400,9500,10192,9681,10341,10423,11244,8700,9
572,973
4,10428,9890,10508,10708,11366,10112,10734,1088
6,11505,10980,11642,11788,12469,5439,6574,6752,7
794,696
6,7887,8039,8890,7076,8094,8206,9048,8327,9118,9
157,10000,7301,8274,8421,9162,8541,9371,9470,101
64,8688,
9542,9670,10383,9798,10476,10634,11253,7468,848
3,8637,9491,8846,9642,9625,10486,8929,9760,9827,
10602,10
031,10717,10786,11519,9105,9899,10092,10759,101

72,10926,10988,11665,10302,11058,11166,11835,11
383,1197
0,12126,12729,7590,8721,8863,9774,9020,9865,1003
7,10742,9357,10101,10228,10954,10251,11006,1111
7,11763,
9425,10236,10292,11091,10494,11160,11330,11941,
10668,11375,11455,12015,11579,12197,12298,12833
,9548,10
542,10620,11262,10792,11401,11477,12087,10896,1
1565,11677,12262,11801,12366,12509,13059,11184,
11694,11
848,12400,11988,12557,12619,13250,12098,12677,1
2781,13333,12931,13479,13661,14198,5651,6845,70
23,8098,
7277,8255,8399,9288,7351,8443,8580,9388,8715,951
6,9708,10642,7550,8653,8884,9606,8980,9858,9805,
10686,9
059,9928,10056,10869,10213,10936,11032,11728,79
55,8941,9070,9851,9352,10014,10127,10962,9382,10
220,102
67,11041,10349,11126,11211,11903,9431,10324,104
54,11202,10659,11321,11435,12027,10769,11535,11
570,1220
7,11686,12311,12431,12984,8015,9341,9366,10180,9
438,10244,10372,11153,9562,10502,10610,11286,10
725,114
07,11556,12167,10084,10651,10800,11447,10903,11
622,11700,12279,11144,11714,11856,12409,11997,1
2543,126
07,13232,10259,10919,11082,11631,11193,11818,11
924,12455,11351,11959,12048,12594,12156,12691,1
2820,133
87,11470,12105,12227,12768,12347,12861,12973,13
519,12478,13029,13117,13623,13201,13803,13848,1
4523,805
9,9455,9505,10623,10009,10700,10776,11528,10141,
10860,10945,11651,11108,11754,11892,12443,10282
,11023,1
1175,11783,11271,11929,12054,12582,11416,12137,
12036,12655,12292,12805,12917,13441,10676,11229
,11313,1
1977,11514,12075,12219,12742,11608,12237,12335,
12874,12419,12944,13072,13599,11810,12378,12502
,13000,1
2633,13152,13218,13754,12706,13314,13369,13905,
13497,13980,14044,14389,10910,11342,11599,12249
,11748,1
2323,12388,12957,11876,12522,12569,13107,12668,
13166,13350,13827,11911,12642,12752,13300,12900
,13405,1
3420,14009,13045,13539,13580,14070,13712,14239,
14309,14803,12174,12850,12891,13460,13090,13558
,13646,1
4135,13183,13731,13775,14271,13929,14346,14573,
14950,13265,13877,13954,14433,14100,14472,14621
,15039,1
4167,14679,14735,15146,14872,15263,15430,15666,
2542,3919,4553,5753,4924,5885,6220,7105,5186,611
5,6400,7
292,6632,7496,7565,8647,5410,6320,6485,7453,6826
,7671,7949,8733,6998,7925,7804,8872,8218,9025,91
29,9972,
5598,6703,6950,7741,7054,7891,8063,8912,7338,816
4,8268,9042,8547,9247,9330,10144,7532,8316,8608,
9299,87
09,9436,9567,10264,8857,9597,9729,10491,9793,105
88,10755,11525,6006,6768,7196,8139,7379,8241,852
3,9168,
7605,8631,8339,9346,8794,9480,9651,10337,7861,85
86,8834,9581,8952,9689,9784,10548,9098,9820,9995
,10679,
10129,10812,10933,11737,8116,8895,9064,9767,926
3,9894,10072,10780,9402,10087,10256,10880,10360,
11044,1
1163,11906,9620,10318,10523,11088,10570,11172,1
1324,12041,10728,11372,11487,12146,11596,12240,
12397,13
096,6558,7150,7413,8569,7704,8694,8756,9637,7979
,8817,8969,9753,9113,9885,9933,10772,8190,8991,9
151,990
7,9316,10064,10221,10899,9464,10231,10326,11003,
10539,11138,11292,11991,8387,9215,9418,10121,94
95,1024
1,10391,11096,9745,10499,10580,11190,10719,1136
3,11449,12141,9924,10654,10794,11404,10890,1156
7,11611,1
2225,11053,11674,11824,12357,11935,12471,12697,
13103,8477,9450,9675,10417,9872,10556,10711,113
86,9980,
10736,10829,11517,10942,11602,11731,12320,10200
,10906,11012,11663,11181,11798,11917,12506,1125
9,11946,
12062,12601,12179,12739,12818,13424,10378,11105
,11214,11845,11413,11985,12080,12671,11591,1211
9,12234,
12785,12362,12837,13018,13588,11726,12277,12403
,12933,12459,13070,13149,13719,12687,13187,1327
1,13692,
13358,13823,13988,14487,6893,7638,7774,8935,800
9,9008,9181,10051,8033,9199,9362,10154,9525,1034
6,10431,
11274,8361,9377,9535,10460,9707,10531,10637,112
83,9807,10627,10762,11482,10916,11585,11634,122
22,8433,
9665,9832,10483,10017,10662,10803,11576,10107,1
0863, 10951, 11645, 11035, 11785, 11870, 12446,
10099, 11017, 11
120,11777,11250,11927,12004,12603,11429,12093,1
2182,12733,12271,12814,12950,13543,8670,9955,10
029,1084
6,10185,10985,11114,11743,10272,11154,11205,119
14,11333,12038,12113,12722,10745,11301,11423,12
059,11533 ,12164,12264,12798,11688,12296,12424,1
2920,12525,13066,13159,13669,10977,11502,11654,
12212,11771,12350 ,12438,13021,11894,12487,1255
9,13093,12704,13226,13304,13787,12072,12693,127

46,13275,12801,13362,13246 ,13863,12977,13527,13592,14018,13619,14189,14276,14589,8777,10169,10208,11241,10670,11354,11444,12090, 10854,11476,11538,12195,11683,12308,12415,13035,10959,11671,11766,12313,11841,12440,12537,13114,11953, 12573,12662,13204,12788,13289,13416,13884,11265,11795,11868,12527,11999,12636,12759,13254,12192,12762, 12824,13409,12981,13347,13565,14027,12340,12897,13052,13532,13124,13614,13680,14140,13228,13703,13700, 14253,13868,14318,14384,14784,11496,11938,12101,12765,12304,12827,12940,13453,12428,13025,13080,13596, 13180,13630,13696,14175,12541,13138,13257,13673,13308,13716,13872,14323,13449,13909,13968,14403,14083, 14512,14579,14982,12726,13279,13394,13880,13561,13889,14057,14438,13585,14039,14149,14548,14225,14631, 14740,15112,13634,14193,14299,14669,14360,14762,14706,15168,14477,14836,14896,15292,15007,15363,15447, 15655,7249,7829,8084,9081,8290,9393,9549,10401,8409,9611,9715,10451,9860,10605,10645,11547,8455,9846,99 46,10596,10042,10994,11061,11717,10287,11079,11232,11900,11345,12012,12111,12779,8501,10004,10177,1102 6,10303,11223,11310,11973,10409,11380,11458,12128,11559,12247,12332,12840,10513,11508,11628,12289,1175 1,12412,12474,12998,11807,12452,12575,13131,12591,13197,13286,13997,9232,10295,10368,11339,10471,11467 ,11553,12210,10694,11640,11697,12381,11821,12499,12566,13041,10837,11708,11859,12462,11965,12587,12617, 13163,12051,12623,12658,13296,12893,13365,13505,14036,10968,11962,12025,12652,12159,12748,12775,13329, 12255,12884,12960,13445,13086,13550,13603,14153,12372,13008,13127,13611,13236,13664,13794,14229,13390, 13811,13913,14327,13971,14423,14527,14963,9285, 10439,10613,11619,10820,11706,11832,12518,10925,11879,1 1980,12626,12077,12684,12710,13310,11147,12030, 12152,12713,12252,12870,12937,13430,12369,12987,13082,1 3572,13173,13637,13744,14158,11315,12201,12326, 12954,12483,13062,13049,13650,12550,13141,13190,13723,1 3337,13799,13844,14337,12675,13244,13379,13831, 13434,13938,13976,14442,13523,14022,14104,14553,14248,1 4642,14751,15127,11438,12393,12493,13155,12610, 13222,13339,13815,12857,13383,13471,13959,13490,13993,1 4065,14507,12904,13475,13512,14052,13653,14096, 14212,14626,13767,14243,14290,14674,14380,14790,14860,1 5189,12994,13689,13735,14162,13851,14257,14313, 14718,13917,14369,14448,14831,14532,14902,14995,15324,1 4114,14457,14558,14920,14658,15021,15059,15421, 14723,15092,15161,15473,15240,15546,15644,15897,9511,10 701,10873,11889,11129,12020,12131,12807,11196,12170,12283,12880,12384,12971,13110,13751,11395, 12338,12 513,13039,12585,13212,13177,13779,12639,13261,13354,13897,13464,13946,14006,14483,11760,12553, 12646,13 208,12854,13325,13402,13963,12876,13467,13501,14014,13554,14074,14130,14599,12910,13535,13626, 14122,13 763,14207,14281,14685,13836,14351,14375,14796,14453,14867,14938,15277,11812,12844,12863,13438, 12914,13 482,13569,14091,13004,13657,13728,14185,13807,14262,14365,14773,13375,13759,13856,14285,13921, 14409,14 462,14843,14087,14468,14563,14926,14663,15014,15053,15413,13493,13934,14049,14413,14117,14542, 14610,14 957,14221,14636,14696,15046,14768,15099,15182,15500,14304,14729,14814,15154,14890,15204,15269, 15564,14 969,15300,15355,15624,15396,15721,15743,16024,11853,12923,12964,13739,13322,13791,13839,14341, 13413,13 892,13951,14428,14061,14502,14595,14945,13508,14001,14109,14517,14170,14615,14701,15033,14267, 14756,14 691,15079,14854,15175,15232,15527,13771,14145,14202,14647,14332,14712,14808,15133,14398,14819, 14885,15 210,14933,15247,15331,15613,14538,14908,14988,15284,15066,15371,15404,15697,15106,15464,15490, 15766,15 555,15803,15828,15973,13926,14216,14394,14825,14497,14878,14914,15255,14583,15001,15027,15348, 15086,15 379,15482,15731,14605,15073,15140,15456,15225,15508,15518,15816,15316,15574,15604,15842,15676, 15911,15 942,16122,14779,15196,15218,15536,15339,15585,15634,15868,15388,15687,15709,15926,15779,15956, 16042,16 169,15438,15755,15791,15990,15856,16006,16060,16194,15883,16080,16101,16222,16144,16254,16289, 16330,42 1,1086,1508,2524,1807,2651,3140,3946,2033,3057,3300,4126,3502,4330,4405,5581,2219,3221,3368,4291,3685,45 43,4854,5676,3847,4825,4674,5804,5116,5959,6071,6941,2379,3566,3795,4611,3895,4796,4962,5839,4170,5067,5168,5975,5459,6179,6268,7132,4366,5213,5542,6238,5640,6380,6514,7260,5788,6541,6689,7508,6761,7619,7809,8655,2762,3626,4039,5043,4211,5141,5436,6102,4440,5562,5261,6283,5734,6434,6615,7344,4767,5499,5769,6526,5874,6653,6750,7578,6040,6785,6975,7719,7121,7863,7997,8914,5015,5823,6009,6738,6210,6875,7059,7831,6353,7070,7251,7939,7372,8121,8243,9122,6577,7327,7542,8157,7603,8251,8425,9287,7768,8473,8616,9420,8742,9532,9727,10618,3440,3993,4251,5479,4577,5620,5695,6591,4879,5750,5893,6726,6056,6863,6909,7823,5092,5909,6087,6886,6253,7050,7220,7953,6422,7231,7336,8078,7561,8214,8385,9230,5305,6149,6367,7110,6449,7240,7400,8162,6700,7525,7611,8272,7760,8465,8571,9404,6898,7694,7839,8513,7945,8705,8760,9518,8135,8838,9023,9677,9155,9817,10106,10621,5396,6395,6641,7428,6843,7586,7751,8499,6953,7776,7885,8649,8005,8754,8903,9627,7201,7975,8086,8821,8257,8990,9133,9867,8343,9172,9312,9977,9454,10155,10258,11039,7391,8176,8300,9046,8525,9214,9334,10069,8734,9384,9521,10215,9682,10277,10507,11252,8897,9579,9736,10399,9800,10578,10678,11430,10089,10730,10839,11394,10949,11580,11811,12510,3738,4474,4641,5858,4908,5925,6118,7038,4937,6133,6295,7141,6475,7355,7445,8371,5285,6310,6488,7481,6665,7553,7669,8377,6773,7653,7815,8604,7983,8729,8790,9512,5352,6627,6796,7500,6996,7702,7847,8723,7101,7923,8013,8802,8106,8978,9079,9791,7090,8092,8194,8961,8337,9149,9239,9990,8539,9353,9463,10150,9565,10246,10422,11195,5601,6930,7016,7901,7181,8057,8184,8926,7279,8237,8294,9127,8431,9281,9379,10134,7792,8391,8533,9308,8661,9443,9560,10230,8855,9599,9759,10384,9887,10572,10692,11361,8043,8629,8813,9498,8956,9669,9772,10518,9107,9839,9926,10607,10111,10781,10882,11521,9323,10102,10167,10842,10235,10957,10808,11632,10455,11177,11261,11861,11296,12086,12206,12647,5714,7152,7212,8329,7710,8459,8559,9348,7915,8590,8680,9479,8850,9616,9755,10529,8027,8832,8950,9621,9040,9781,9901,10640,9177,9943,10061,10750,10223,10865,11030,11664,8363,8984,9074,9892,9236,10024,10179,10815,9468,10182,10261,11018,10467,10937,11225,11875,9658,10359,10558,11180,10643,11289,11379,12016,10784,11414,11405,12175,11641,12263,12364,12932,8624,9160,9359,10195,9607,10274,10415,11080,9764,10521,10586,11269,10723,11314,11403,12070,9904,10667,10822,11370,10885,11422,11650,12273,11071,11698,11787,12389,11939,12542,12629,13217,10139,10851,11001,11658,11216,11673,11907,12430,11246,11883,12031,12595,12145,12709,12866,13428,11317,12094,12241,12764,12321,12892,12819,13498,12491,13009,13089,13694,13256,13798,13923,14261,4084,4734,4990,6025,5189,6325,6500,7411,5329,6553,6677,7472,6831,7636,7680,8686,5373,6808,6921,7628,7027,8064,8141,8891,7288,8149,8323,9111,8453,9250,9370,10210,5416,6984,7161,8100,7307,8308,8405,9203,7419,8493,8578,9395,8698,9537,9646,10285,7534,8641,8779,9593,8931,9741,9826,10489,8995,9795,9951,10657,9973,10747,10859,11828,6164,7299,7383,8439,7491,8584,8692,9493,7735,8796,8861,9705,9018,9853,9940,10543,7893,8886,9068,9814,9192,9965,10002,10703,9303,10010,10057,10871,10354,10966,11145,11880,8035,9188,9267,10044,9429,10170,10198,10914,9555,10342,10436,11068,10604,11204,11275,12040,9700,10503,10653,11281,10795,11352,11540,12153,10995,11563,11707,12282,11794,12416,12558,13196,6225,7464,7644,8765,7869,8867,9034,9875,7991,9090,9208,10019,9328,10086,10119,10894,8229,9277,9423,10126,9546,10320,10410,11042,9686,10473,10593,11240,10709,11326,11466,12047,8411,9487,9641,10430,9836,10569,10555,11335,9914,10675,10737,11436,10923,11549,11612,12297,10074,10801,10979,11589,11052,11747,11802,12436,11168,11869,11972,12602,12168,12727,12875,13439,8553,9724,9848,10689,9994,10770,10928,11572,10305,10989,11103,11773,11121,11820,11922,12530,10365,11109,11159,11899,11341,11963,12117,12702,11501,12160,12233,12771,12355,12945,13038,13534,10481,11385,11454,12055,11615,12184,12256,12839,11716,12339,12448,13003,12570,13101,13235,13733,11987,12466,12613,13133,12747,13278,13338,13896,12849,13392,13487,13966,13622,14090,1
4242,14684,6461,7743,7931,9096,8200,9256,9398,10
243,8286,9448,9585,10334,9714,10452,10629,11474,
8505,96
55,9870,10535,9960,10764,10716,11518,10032,1082
8,10946,11690,11089,11756,11844,12498,8943,9923,
10041,1
0761,10300,10908,11007,11781,10331,11092,11139,
11852,11213,11931,12011,12666,10373,11189,11305
,12002,11
492,12109,12214,12783,11595,12315,12349,12951,1
2457,13050,13161,13668,9006,10294,10316,11059,1
0381,111
18,11231,11955,10492,11349,11445,12079,11554,12
190,12331,12915,10969,11486,11624,12226,11721,1
2396,124
73,13020,11948,12485,12621,13140,12754,13269,13
327,13881,11130,11738,11890,12404,11995,12583,1
2683,131
84,12138,12716,12802,13315,12905,13403,13524,14
012,12248,12856,12975,13476,13084,13560,13662,1
4123,132
06,13707,13785,14209,13854,14361,14397,14946,90
51,10396,10441,11457,10902,11530,11604,12305,11
021,1168
1,11764,12423,11915,12523,12654,13174,11151,118
36,11979,12549,12063,12692,12809,13301,12199,12
885,1279
0,13370,13032,13510,13612,14058,11509,12023,121
02,12737,12290,12828,12962,13450,12382,12980,13
071,1357
1,13151,13636,13746,14192,12577,13112,13227,136
83,13348,13813,13867,14319,13418,13952,13999,14
443,1410
6,14508,14557,14839,11730,12130,12374,12991,125
17,13061,13122,13647,12638,13247,13290,13774,13
380,1382
6,13981,14378,12672,13359,13461,13939,13597,140
26,14042,14531,13722,14141,14173,14581,14283,14
716,1477
2,15167,12922,13549,13586,14072,13761,14155,142
28,14633,13840,14302,14338,14744,14465,14805,14
985,1528
7,13910,14420,14485,14873,14604,14906,15024,153
53,14660,15069,15116,15434,15221,15528,15653,15
829,2868 ,4509,5237,6565,5656,6712,7079,8021,594
3,6964,7268,8222,7517,8445,8519,9649,6194,7192,7
364,8397,7727,863
5,8937,9733,7907,8909,8785,9861,9219,9999,10094,
10868,6407,7594,7855,8711,7961,8880,9062,9896,82
65,9166,
9272,10015,9551,10203,10280,11027,8479,9317,961
3,10254,9710,10376,10500,11133,9844,10524,10646,
11338,1
0706,11425,11583,12302,6852,7661,8114,9138,8314,
9245,9526,10131,8565,9635,9343,10297,9786,10418,
10575,1
1201,8844,9588,9822,10510,9931,10612,10698,1139
1,10066,10733,10888,11512,11014,11638,11753,125
05,9116,
9879,10036,10684,10218,10798,10963,11609,10347,
10975,11127,11701,11219,11855,11966,12670,10547
,11183,1
1364,11896,11411,11974,12115,12797,11560,12157,
12268,12896,12370,12985,13130,13768,7436,8070,8
357,9574 ,8672,9696,9747,10561,8973,9808,9948,10
672,10082,10790,10835,11601,9197,9968,10114,108
11,10266,10953,11
097,11718,10404,11106,11192,11817,11382,11942,1
2084,12750,9389,10175,10362,11004,10433,11115,1
1249,1190
4,10661,11347,11417,11990,11551,12151,12230,128
89,10825,11489,11621,12188,11710,12343,12385,12
969,1186
3,12447,12590,13094,12695,13199,13410,13770,948
2,10393,10597,11272,10778,11397,11543,12173,108
79,11569 ,11653,12294,11758,12377,12503,13057,11
077,11727,11825,12435,11981,12565,12680,13231,1
2052,12705,12816 ,13319,12926,13446,13521,14045,
11237,11913,12013,12609,12196,12743,12835,13384
,12365,12871,12976,13491 ,13098,13538,13697,1418
1,12494,13017,13137,13625,13188,13742,13809,142
89,13399,13843,13914,14268,13987 ,14376,14511,14
919,7800,8598,8748,9918,9001,9985,10147,10940,90
29,10159,10311,11033,10463,11207,11284,1
2068,9364,10323,10470,11308,10626,11373,11468,1
2076,10720,11463,11592,12260,11736,12358,12408,
12966,94
34,10589,10741,11329,10911,11498,11630,12351,10
992,11687,11767,12418,11846,12554,12635,13178,1
0982,118
31,11925,12546,12045,12688,12760,13323,12211,12
845,12929,13443,13013,13517,13640,14143,9672,10
856,1092 0, 11670,11065,11800,11920,
12511,11142,11958,12005,12676,12122,
12793,12865,13431,11575,12091,12203, 1281
3,12309,12911,13005,13502,12461,13036,13156,136
15,13251,13740,13820,14250,11791,12281,12427,12
959,1253
9,13085,13165,13701,12659,13213,13281,13764,134
14,13874,13941,14345,12823,13407,13454,13916,13
506,1399
0,13893,14410,13663,14129,14183,14539,14206,146
76,14748,14998,9769,11046,11083,12037,11506,121
42,12223 ,12841,11678,12253,12317,12941,12454,13
047,13147,13711,11775,12442,12535,13053,12606,1
3170,13260,13781 ,12714,13294,13378,13857,13495,
13932,14037,14427,12061,12561,12631,13252,12758
,13352,13465,13899,12936 ,13469,13528,14030,1366
6,13977,14163,14546,13079,13593,13729,14134,137
88,14203,14256,14635,13878,14278 ,14275,14727,14
412,14781,14834,15153,12275,12699,12853,13472,1
3043,13531,13633,14069,13160,13705,13750 ,14188,
13837,14217,14273,14667,13264,13802,13903,14254
,13945,14287,14417,14786,14066,14447,14496,1485
1 ,14588,14936,14989,15306,13435,13920,14020,144

25,14159,14432,14570,14877,14178,14554,14644,14967,14708 ,15034,15121,15411,14220,14680,14764,15060,14813,15134,15094,15451,14910,15197,15241,15550,15327,15601 ,15667,15820,8170,8808,9085,10049,9292,10339,10484,11258,9414,10540,10635,11302,10767,11442,11480,1232 4,9459,10753,10845,11433,10934,11808,11872,12486,11156,11887,12029,12660,12135,12769,12859,13484,9502, 10897,11056,11839,11171,12022,12099,12731,11263,12166,12238,12879,12336,12989,13068,13542,11358,12287, 12401,13027,12521,13144,13202,13679,12571,13179,13298,13796,13311,13850,13927,14519,10190,11165,11228, 12124,11320,12245,12330,12955,11527,12411,12467,13116,12589,13225,13285,13718,11661,12479,12625,13192, 12725,13306,13334,13822,12803,13340,13374,13935,13590,13995,14111,14550,11784,12721,12780,13367,12907, 13458,13480,13962,12999,13582,13651,14063,13757,14148,14195,14649,13108,13690,13792,14199,13886,14246, 14353,14711,14015,14368,14450,14789,14500,14864,14949,15296,10238,11293,11448,12392,11644,12475,12599, 13242,11744,12643,12738,13344,12830,13395,13421,13949,11949,12786,12901,13425,12995,13567,13629,14047, 13104,13672,13753,14169,13830,14223,14312,14651,12106,12946,13064,13644,13209,13736,13725,14232,13273, 13805,13846,14294,13970,14356,14395,14798,13388,13890,14005,14382,14051,14473,14504,14881,14126,14543, 14609,14972,14725,15043,15124,15418,12218,13126,13221,13816,13330,13871,13974,14372,13556,14008,14084, 14488,14098,14515,14577,14931,13601,14088,14120,14565,14235,14601,14695,15029,14331,14720,14760,15065, 14830,15157,15211,15469,13675,14264,14305,14655,14402,14731,14777,15102,14455,14822,14886,15192,14954, 15245,15317,15570,14617,14893,14975,15260,15052,15337,15369,15646,15107,15395,15445,15686,15510,15744, 15812,16004,10447,11534,11693,12650,11934,12776,12882,13513,11998,12918,13023,13579,13119,13658,13778, 14316,12181,13075,13239,13714,13305,13864,13833,14342,13355,13907,13983,14440,14076,14478,14526,14916, 12529,13276,13363,13861,13553,13958,14024,14493,13575,14079,14108,14534,14152,14586,14628,15006,13604, 14137,14214,14623,14326,14692,14753,15075,14387,14809,14826,15163,14889,15216,15276,15539,12579,13545, 13564,14055,13608,14094,14166,14597,13686,14240,14297,14671,14363,14736,14817,15144,14002,14324,14405, 14755,14458,14855,14898,15201,14593,14901,14979,15266,15056,15332,15364,15639,14102,14470,14562,14859, 14620,14964,15016,15291,14703,15038,15084,15358,15139,15401,15462,15707,14769,15111,15177,15441,15235, 15479,15532,15759,15302,15557,15595,15797,15626,15870,15888,16100,12618,13618,13655,14308,13956,14349, 14390,14801,14033,14435,14480,14869,14574,14928,15003,15281,14116,14524,14612,14942,14664,15019,15088, 15349,14739,15130,15078,15384,15207,15457,15503,15728,14334,14639,14687,15047,14794,15097,15172,15423, 14846,15183,15230,15486,15271,15515,15576,15788,14958,15251,15312,15544,15375,15607,15633,15853,15407, 15680,15701,15906,15750,15933,15953,16062,14463,14700,14842,15187,14924,15227,15256,15521,14993,15321, 15342,15588,15391,15614,15693,15879,15011,15380,15429,15673,15497,15714,15722,15944,15563,15765,15781, 15963,15837,16016,16037,16175,15149,15474,15491,15737,15581,15774,15805,15983,15620,15845,15862,16027, 15916,16050,16114,16210,15659,15898,15924,16074,15974,16087,16129,16229,15994,16142,16158,16251,16191, 16274,16302,16337,2966,4704,5519,7007,5991,7172,7686,8667,6338,7569,7877,8874,8127,9101,9183,10350,6603 ,7784,7969,9057,8349,9339,9630,10444,8545,9602,9473,10564,9909,10712,10804,11566,6819,8208,8485,9409,86 10,9571,9750,10601,8920,9856,9957,10726,10249,10905,10986,11733,9144,10007,10308,10960,10407,11074,111 98,11842,10550,11222,11344,12050,11408,12140,12293,12928,7316,8280,8771,9831,8967,9935,10226,10831,922 5,10328,10052,10998,10495,11124,11278,11910,9541,10289,10532,11210,10632,11311,11400,12104,10775,11427, 11598,12221,11724,12342,12444,13109,9803,10583,10744,11388,10931,11503,11667,12312,11049,11676,11834,1 2399,11937,12545,12634,13249,11255,11893,12081,12567,12127,12640,12763,13360,12266,12799,12898,13448,1 2986,13522,13648,14230,8049,8717,9012,10269,9373,10388,10459,11266,9663,10515,10650,11376,10787,11495, 11537,12307,9884,10664,10818,11515,10972,11655,11805,12413,11112,11814,11901,12507,12097,12611,12734,13320,10097,10874,11062,11713,11136,11822,11960,12574,11355,12066,12133,12656,12258,12796,12869,13440,11524,12200,12319,12826,12407,12963,13002,13511,12551,13054,13182,13617,13270,13713,13904,14233,10187,11086,11299,11984,11471,12112,12251,12815,11578,12270,12353,12924,12451,12996,13099,13583,11790,12426,12514,13044,12644,13157,13259,13745,12708,13284,13377,13821,13470,13937,14003,14484,11952,12586,12673,13198,12836,13313,13393,13883,12982,13423,13514,13975,13620,14017,14161,14607,13095,13551,13656,14095,13702,14208,14269,14709,13895,14298,14366,14688,14431,14787,14905,15243,8419,9261,9439,10615,9691,10681 ,10848,11647,9719,10862,11011,11741,11162,11918,12001,12724,10077,11024,11174,12026,11323,12088,12186,12730,11420,12171,12300,12894,12432,12978,13022,13507,10142,11290,11439,12043,11618,12208,12327,12972,11704,12386,12458,13030,12533,13150,13220,13695,11696,12519,12597,13142,12701,13266,13328,13828,12848,13404,13477,13933,13544,13996,14110,14575,10370,11557,11627,12368,11770,12489,12593,13113,11858,12627,12667,13255,12767,13357,13419,13925,12278,12741,12843,13372,12935,13462,13540,13986,13067,13566,13674,14085,13758,14201,14277,14670,12482,12909,13040,13500,13136,13609,13685,14168,13237,13727,13786,14226,13908,14330,14391,14757,13385,13902,13944,14367,13989,14436,14347,14815,14132,14564,14613,14929,14634,15042,15100,15305,10478,11750,11797,12696,12215,12789,12858,13400,12380,12883,12942,13485,13063,13577,13670,14176,12470,13048,13132,13581,13193,13688,13769,14244,13288,13797,13875,14311,13982,14381,14479,14832,12718,13154,13216,13762,13324,13852,13953,14352,13481,13957,14007,14471,14136,14424,14591,14937,13606,14068,14194,14566,14247,14629,14678,15008,14333,14699,14694,15085,14818,15128,15174,15433,12902,13274,13408,13964,13570,14013,14103,14509,13678,14172,14210,14618,14296,14643,14693,15035,13773,14260,14354,14675,14392,14704,14823,15131,14503,14847,14892,15186,14968,15258,15298,15554,13928,14373,14461,14827,14587,14835,14953,15206,14603,14940,15015,15282,15070,15335,15405,15640,14645,15045,15117,15359,15155,15416,15383,15668,15234,15467,15501,15745,15571,15785,15834,15955,8827,9507,9778,10758,9982,11036 ,11186,11969,10122,11234,11332,12019,11460,12155,12193,12949,10162,11451,11546,12148,11635,12495,12555, 13091,11866,12563,12689,13241,12784,13335,13415,13972,10207,11606,11761,12526,11884,12679,12751,13303, 11976,12810,12872,13433,12958,13526,13595,14021,12073,12919,13012,13563,13118,13659,13720,14150,13164, 13699,13804,14255,13817,14310,14377,14912,10891,11877,11945,12773,12034,12878,12953,13496,12236,13026, 13073,13635,13175,13737,13793,14186,12361,13087,13211,13710,13295,13810,13838,14282,13368,13842,13873, 14385,14064,14441,14547,14939,12477,13291,13345,13866,13455,13947,13965,14411,13537,14059,14119,14501, 14222,14580,14622,15018,13631,14160,14251,14625,14339,14666,14765,15074,14459,14778,14852,15137,14897, 15199,15265,15545,10943,12008,12163,13007,12346,13077,13189,13752,12439,13230,13309,13849,13389,13891, 13915,14399,12622,13353,13451,13919,13529,14043,14101,14486,13624,14142,14215,14602,14288,14650,14728, 15023,12756,13492,13591,14113,13724,14200,14190,14654,13776,14266,14303,14713,14416,14770,14804,15143, 13885,14344,14449,14791,14491,14871,14900,15209,14559,14934,14984,15286,15081,15343,15408,15643,12852, 13645,13734,14274,13832,14325,14419,14782,14034,14454,14520,14883,14533,14909,14960,15253,14075,14525, 14555,14948,14659,14981,15057,15330,14746,15077,15113,15362,15171,15437,15478,15681,14146,14683,14721, 15026,14806,15089,15123,15392,14856,15164,15215,15463,15270,15505,15561,15760,14992,15222,15290,15519, 15351,15579,15603,15823,15397,15625,15662,15849,15715,15895,15949,16091,11148,12242,12395,13233,12605, 13342,13436,13994,12663,13466,13555,14053,13642,14128,14237,14733,12822,13602,13748,14179,13808,14320, 14291,14754,13855,14359,14429,14844,14514,14876,14921,15238,13128,13784,13862,14317,14032,14406,14466, 14888,14050,14516,14541,14925,14585,14965,15004,15314,14077,14571,14638,14999,14742,15054,15103,15367,
14795,15151,15166,15442,15219,15484,15531,15735,13171,14025,14040,14495,14082,14530,14596,14977,14154,
14662,14717,15037,14774,15091,15160,15426,14444,14737,14810,15109,14861,15190,15224,15471,14973,15231,
15294,15522,15354,15575,15598,15818,14537,14868,14944,15194,14996,15278,15323,15541,15067,15338,15376,
15593,15420,15629,15677,15866,15120,15400,15450,15658,15498,15691,15730,15907,15549,15749,15780,15937,
15807,15989,16001,16165,13203,14093,14121,14722,14404,14761,14799,15148,14474,14840,14880,15202,14956,
15250,15310,15535,14549,14917,14987,15262,15030,15326,15378,15589,15096,15414,15370,15617,15476,15671,
15711,15884,14749,15012,15049,15345,15141,15387,15446,15649,15184,15454,15493,15695,15526,15720,15764,
15931,15274,15511,15559,15740,15608,15792,15813,15976,15636,15844,15861,16017,15901,16036,16053,16136,
14863,15063,15179,15459,15246,15488,15514,15725,15303,15566,15583,15776,15621,15796,15855,15996,15318,
15611,15652,15839,15705,15873,15877,16045,15756,15913,15925,16059,15964,16102,16117,16220,15428,15688,
15702,15889,15770,15919,15945,16076,15801,15969,15981,16109,16023,16126,16176,16247,15827,16009,16030,
16146,16068,16154,16185,16262,16084,16198,16208,16279,16233,16296,16317,16344,7455,9297,10027,11243,10
425,11367,11684,12463,10695,11586,11849,12615,12058,12777,12832,13598,10917,11778,11928,12745,12229,12
913,13123,13652,12373,13105,13016,13741,13317,13834,13898,14383,11100,12120,12334,12968,12420,13081,13
207,13765,12651,13280,13349,13845,13533,13969,14019,14476,12806,13382,13574,14000,13639,14081,14156,14
540,13730,14174,14249,14656,14284,14705,14788,15145,11483,12178,12538,13262,12685,13332,13518,13922,12
862,13587,13397,14028,13691,14107,14205,14578,13058,13559,13717,14165,13790,14227,14280,14686,13879,14
301,14396,14752,14469,14816,14874,15242,13245,13756,13858,14270,13978,14340,14439,14800,14062,14446,14
535,14850,14590,14927,14983,15315,14187,14567,14672,14947,14697,14986,15055,15374,14775,15076,
15129,15
417,15178,15455,15517,15773,11992,12501,12712,13548,12938,13628,13667,14196,13146,13706,13801,14263,13
887,14335,14362,14797,13299,13814,13911,14348,14011,14434,14518,14858,14097,14522,14572,14907,14682,14
970,15040,15352,13429,13950,14071,14464,14115,14529,14606,14952,14258,14661,14702,14994,14771,15071,15
110,15415,14358,14738,14807,15090,14853,15165,15185,15449,14930,15213,15280,15502,15328,15547,15631,15
775,13488,14089,14219,14619,14329,14689,14766,15083,14388,14780,14824,15142,14879,15181,15239,15487,14
506,14862,14911,15208,14991,15268,15320,15560,15025,15333,15382,15596,15431,15647,15675,15878,14598,14
955,15005,15289,15095,15350,15390,15622,15176,15406,15453,15663,15504,15683,15746,15928,15236,15470,15
520,15717,15542,15763,15789,15966,15628,15802,15831,15958,15858,15995,16038,16157,12285,12888,12993,13
780,13168,13825,13931,14426,13185,13940,14038,14481,14133,14582,14627,15032,13412,14046,14139,14641,14
236,14677,14730,15036,14292,14726,14792,15126,14865,15173,15195,15448,13459,14213,14306,14652,14407,14
743,14812,15170,14456,14841,14882,15200,14923,15264,15301,15537,14451,14915,14962,15259,15022,15325,15
357,15597,15101,15394,15432,15645,15468,15674,15723,15914,13613,14374,14414,14833,14499,14899,14959,15
244,14545,14978,15002,15319,15058,15373,15403,15641,14783,15044,15098,15381,15150,15424,15465,15669,15
220,15477,15529,15712,15567,15762,15794,15951,14895,15135,15205,15444,15257,15499,15533,15747,15311,15
552,15580,15772,15635,15815,15840,15984,15386,15630,15650,15832,15670,15859,15822,16005,15732,15909,15
929,16047,15936,16089,16110,16179,13681,14489,14510,15017,14747,15068,15108,15393,14837,15122,15152,15
436,15217,15483,15525,15751,14887,15212,15254,15485,15288,15534,15572,15778,15336,15586,15619,15808,15
664,15836,15876,16011,15028,15267,15299,15568,15356,15609,15654,15824,15435,15656,15678,15874,15733,15
854,15921,16049,15496,15704,15758,15910,15782,15935,15954,16077,15817,15961,15960,16105,16007,16119,16 135,16217,15132,15329,15399,15657,15481,15679,15719,15887,15530,15748,15767,15930,15800,15940,15959,16086,15573,15786,15825,15952,15841,15965,16008,16120,15886,16018,16033,16139,16063,16163,16177,16252,15642,15833,15869,16010,15920,16013,16056,16147,15927,16052,16079,16171,16098,16187,16209,16273,15941,16090,16115,16195,16130,16213,16203,16282,16155,16227,16238,16300,16257,16309,16319,16343,12581,13034,13223,13869,13364,14056,14147,14611,13444,14182,14241,14637,14322,14714,14734,15156,13474,14315,14370,14710,14421,14904,14935,15233,14551,14943,15013,15313,15064,15361,15402,15661,13503,14401,14494,14918,14561,15009,15048,15344,14614,15080,15115,15409,15162,15458,15492,15684,14668,15138,15193,15475,15248,15523,15548,15739,15272,15540,15587,15784,15592,15806,15835,16041,13960,14556,14594,15062,14646,15118,15159,15443,14759,15198,15223,15512,15279,15558,15582,15754,14828,15229,15295,15543,15341,15591,15602,15795,15377,15605,15618,15838,15703,15860,15903,16051,14891,15340,15366,15615,15422,15651,15660,15848,15461,15700,15726,15885,15769,15917,15932,16081,15507,15742,15783,15934,15819,15950,15986,16099,15867,15992,16019,16121,16034,16143,16166,16249,13992,14630,14719,15188,14821,15228,15283,15565,14870,15304,15346,15606,15389,15627,15637,15843,14974,15368,15419,15638,15460,15694,15718,15880,15506,15736,15768,15923,15798,15943,15972,16082,15050,15440,15489,15724,15551,15761,15757,15946,15577,15787,15804,15967,15851,15988,16000,16124,15623,15821,15864,15997,15881,16026,16035,16148,15908,16048,16069,16172,16104,16189,16211,16275,15105,15516,15556,15793,15599,15814,15852,15993,15690,15865,15892,16031,15899,16040,16058,16162,15706,15894,15905,16055,15947,16066,16094,16186,15979,16103,16113,16197,16134,16218,16231,16285,15738,15957,15970,16083,16002,16106,16118,16205,16020,16132,16149,16226,16167,16239,16255,16304,16071,16151,16173,16242,16192,16259,16265,16316,16206,16270,16281,16322,16293,16332,16342,16363,14124,14763,14845,15307,14966,15365,15410,15672,14997,15427,15472,15698,15513,15729,15777,15975,15087,15494,15562,15752,15590,15811,15799,15982,15610,15826,15857,16015,15890,16028,16044,16156,15252,15578,15612,15809,15689,15847,15871,16032,15696,15891,15902,16046,15918,16061,16075,16181,15708,15912,15939,16073,15978,16093,16111,16199,15998,16127,16133,16219,16150,16232,16245,16298,15275,15685,15692,15882,15710,15896,15922,16065,15741,15948,15968,16088,15991,16107,16131,16215,15863,15977,16003,16112,16021,16140,16152,16228,16064,16153,16174,16243,16193,16258,16264,16315,15900,16025,16054,16141,16072,16170,16183,16248,16097,16188,16201,16263,16214,16271,16284,16325,16116,16207,16223,16280,16237,16287,16297,16334,16250,16301,16308,16340,16313,16349,16351,16371,15293,15713,15727,15971,15846,15985,15999,16125,15875,16014,16029,16145,16057,16160,16180,16246,15904,16043,16070,16164,16085,16184,16202,16261,16108,16212,16200,16268,16230,16283,16292,16329,15980,16078,16092,16190,16123,16204,16221,16276,16138,16224,16236,16288,16244,16294,16305,16339,16168,16240,16253,16299, 16266, 16310,16314,16347,16272,16321,16324,16353,16333,16356,16358,16368,16022,16095,16137,16225,16159,16234,16241,16295,16178,16256,16260,16307,16269,16311,16323,16350,16182,16267,16278,16320,16291,16327,16328,16357,16303,16335,16338,16359,16345,16364,16366,16376,16216,16286,16290,16331,16306,16336,16341,16361,16312,16346,16348,16365,16354,16367,16372,16378,16318,16352,16355,16369,16360,16370,16373,16379,16362,16374,16375,16380,16377,16381,16382,16383]

**Sequence group 4: Q4_2048**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1024,520 ,288,528,192,544,70,44,131,81,50,73,15,320,133,52,23,134,384,76,137,82,56,27,97,39,259,84,138,145,261,29,43,98,515,88,140,30,146,1025,71,262,265,161,576,45,100,640,1026,51,148,46,75,266,273,517,104,162,53,193,1028,15 2,77,164,768,268,274,518,54,83,57,521,112,1032,135,78,289,194,85,276,522,58,168,139 ,99 ,86,60,280,89,290,529,524,196,141,1040,101,147,176,142,530,321,31,200,90,1056,545,292,322,532,263,149,102,105,304,296,1027,163,92,1029,47,267,385,546,324,208,386,150,153,165,106,55,328,1088,536,577,548,1033,113,154,79,269,108,578,224,166,519,552,195,270,1030,641,1041,523,275,580,291,59,169,560,114,277,156,87,1034,197,116,170,61,1042,531,525,642,281,278,526,177,293,388,1152,91,584,769,198,172,120,201,336,62,282,143,1036,1057,103,178,294,93,1089,644,202,592,323,392,297,770,107,180,1044,151,209,284,1280,648,94,204,298,400,608,1058,352,325,533,155,210,305,547,300,109,1048,184,534,1060,537,115,1031,167,225,326,306,772,157,656,329,110,117,212,171,1153,776,1090,330,1536,226,549,1035,538,387,308,216,416,271,279,158,337,550,672,1064,118,332,579,540,1092,389,173,1154,121,553,199,784,179,228,338,312,1043,704,1037,390,174,554,581,1072,393,283,122,448,353,561,1038,203,63,340,394,1096,1281,527,582,556,181,295,1045,285,232,124,205,182,643,1156,562,286,585,299,354,1059,211,401,1282,185,1050,396,344,586,645,1537,593,535,240,1104,206,95,327,564,800,402,356,307,301,417,1061,213,1049,568 ,1046,832,588,1160,1284,186,646,404,1288,227,896,594,418,302,649,771,360,539,111,1062,331,1538,214,309,1120,1091,188,449,1065,217,408,609,596,551,650,229,159,420,310,1168,541,1052,773,610,657,333,1093,119,1066,600,339,1540,218,368,652,1073,230,391,313,450,542,1098,334,1296,233,555,774,175,123,1184,658,612,341,777,220 ,314,1544,424,1312,395,673,583,355,1552,1216,287,183,234,1568,125,557,1094,660,616,342,316,1068,241,778,563,1155,345,452,397,403,1105,207,1074,674,558,785,1097,432,1039,357,187,1344,236,664,1157,624,587,780,1076,1047,705,126,242,1158,565,398,346,456,358,405,303,569,1408,244,1100,1161,595,1106,189,566,676,1080,1051,1121,361,706,589,1063,215,786,647,348,419,406,464,680,801,1283,362,1108,590,409,1162,570,1169,788,1285,1053,597,1067,572,1122,219,311,708,598,1539,601,651,421,792,802,611,1112,602,1164,410,231,688,653,1054,248,1170,369,190,364,1095,654,1286,659,1289,335,480,315,221,370,1185,613,1600,422,425,451,1069,614,543,1124,235,412,343,372,1664,775,317,1075,222,1172,426,453,237,1070,559,1099,1290,833,804,712,1297,834,661,1541,808,779,1128,617,604,1186,433,720,816,1077,1217,836,347,897,1176,243,1101,662,1188,454,318,675,1792,618,1292,898,781,1298,1542,376,428,1078,665,736,567,1107,1081,1545,840,625,238,1136,359,457,399,787,591,678,434,677,1159,1102,349,1313,1218,245,1109,458,666,1300,620,1546,1082,1192,363,127,1163,191,1123,782,407,436,626,1110,571,465,681,246,707,1084,350,1304,599,668,1113,790,1314,1553,460,1548,1220,249,682,1165,573,1125,411,803,1171,789,1200,709,365,440,628,689,374,1166,423,1554,466,793,1345,250,371,1055,481,574,1224,413,1114,603,366,1569,1316,1346,468,1556,655,900,805,615,1287,684,1173,710,1126,429,794,252,1129,373,605,1328,848,690,713,632,1320,482,806,1187,1116,427,1071,904,1291,414,1409,223,1570,1348,663,692,835,1232,619,472,1410,455,796,1174,1177,809,714,1189,721,837,716,1130,1079,1352,864,810,1560,606,1601,912,1572,722,696,377,1137,435,1178,1103,817,1293,1132,319,621,1602,812,484,1248,430,1190,1543,1576,838,667,1219,488,1294,239,378,459,622,1665,627,437,380,1547,1299,818,1604,1315,461,1083,496,669,1193,1584,679,1138,1301,1180,724,841,1111 ,629,1221,351,467,1140,438,1194,737,251,462,442,441,1085,469,1555,247,683,1549,1666,842,1305,1302,738,1550,1201,899,1317,670,1412,783,1115,849,1608,1793,820,1222,728,928,791,367,1196,901,1144,630,1225,685,844,1360,633,711,1086,253,691,1306,824,1167,902,686,1127,1202,1318,1117,740,1668,850,375,1226,444,1616,470,1347,483,1416,415,485,905,1321,795,473,1794,634,744,1131,852,960,1204,865,693,1175,1233,1308,797,1672,1118,1228,906,1322,715,1424,1632,807,474,636,1376,694,254,1349,1557,717,1179,1234,575,913,1329,798,811,379,1571 ,1324,1133,697,1208,431,1558,607,1561,489,1139,866,723,486,1191,1249,1350,908,1330,1796,718,813,1181,476,856,1680,1353,839,1134,1141,1236,725,698,1195,914,1800,752,868,819,1354,814,439,929,1250,1573,490,1562,1411,623,1332,1240,671,1440,1295,739,1303,1182,1361,916,1574,463,1696,843,1142,381,1356,1603,497,1564,930,821,726,961,1413,1197,872,1145,492,1577,1223,631,1808,1203,729,1252,1362,700,1336,443,1728,741,1414,1198,1 578,1605,845,1417,920,382,1307,822,1146,851,1472,
730,1377,498,880,1585,742,445,1227,471,635,1087,1
364,932 ,1418,687,1551,1606,1580,1205,1319,903,13
09,825,1256,1148,500,1229,846,1206,1667,745,826,7
32,1586,446,962 ,1310,1609,936,1323,475,853,1378,
867,637,1235,1425,1209,907,1420,1368,1610,1669,4
87,1617,695,1559,1264,74
6,828,753,1230,854,1119,1351,857,1588,1824,504,79
9,1426,255,964,1380,909,1331,1325,1441,719,1237,4
77,1592 ,915,1856,1612,638,748,944,1210,1670,1428
,869,1251,1920,491,699,1618,1442,754,1326,1673,85
8,1795,1384,156
3,478,968,1135,383,1355,910,1238,815,1333,976,870
,1212,1473,917,1241,1432,1633,1620,727,1575,1674,
493,125
3,1183,1444,873,1334,701,1565,931,1797,1634,1681,
1357,756,1143,860,499,731,1624,1363,823,1242,922,
1392,16
76,874,1254,1415,918,1337,1474,502,1566,933,1358,
1257,1579,1798,1199,1147,743,1682,760,1636,1365,
881,180
1,494,1244,1338,702,921,1448,501,876,1419,847,169
7,1607,992,1379,447,1311,1207,1258,1149,1581,733,
1684,16
40,1366,1340,827,1265,934,1802,1587,882,937,963,1
369,747,1476,1421,505,1427,855,924,1231,734,829,1
698,158
2,1809,1456,1381,1211,1260,1688,965,1648,1611,18
04,938,884,506,1729,1150,1266,749,1589,1422,945,9
66,1370,
1480,755,1382,859,1429,1327,1593,940,1268,830,16
19,911,1213,1590,1700,871,639,1385,1730,1613,888,
1239,18
10,479,1671,1372,946,1443,1430,750,1488,1704,182
5,969,508,1386,861,1614,1433,1594,757,1812,970,16
21,1596,
919,1243,1335,1732,1622,875,1625,1675,862,1445,1
816,1826,758,1635,948,1626,1434,1255,1712,1677,9
77,1272,
923,1393,972,1214,1388,1678,761,1683,877,1359,15
04,1339,1245,952,1394,495,1637,1446,1449,1475,16
38,1567,
703,1259,1436,1367,1396,935,1799,978,1341,883,76
2,1246,503,1450,925,1477,1261,878,1583,735,1857,1
828,173
6,1858,1685,1832,1803,1641,1628,993,1457,1744,18
40,885,939,994,1860,1371,1921,980,1267,926,764,16
86,941,1
478,1342,1699,1642,1922,1805,1400,1452,967,1689,
1760,1591,886,831,1864,1649,1262,947,1383,1481,5
07,1423,
1811,889,1615,984,1702,1458,1701,751,1373,942,12
69,1482,1690,1644,996,1387,1151,1215,971,1806,14
31,1460,
1650,890,1595,1489,509,1705,1270,1731,949,973,13
74,1623,1692,1814,1000,1484,892,1273,1706,1597,1
435,1827 ,1813,950,1733,1389,1464,1652,1713,863,1
398,759,1447,1490,1817,1274,1395,1008,1505,1598,
1437,510,1627,13
90,979,1492,953,1679,1924,1829,1639,763,1708,974,
1734,1453,1818,1276,1397,1629,1872,1714,1737,165
6,954,1
506,1830,879,981,1451,1928,982,1438,927,1247,168
7,1716,1859,1643,1496,1479,1820,1833,1738,995,17
45,1861,
1740,765,956,1888,1834,887,1630,985,1936,997,174
6,1720,1401,1459,1841,1343,1645,1836,1508,1454,9
86,1862,
1691,1512,943,1263,1402,1483,1646,891,1651,998,1
461,1404,766,1842,1485,1520,1693,1703,511,1748,1
865,1653 ,1375,1491,1462,988,1761,1275,1486,1466,
1465,1001,951,1493,1271,1707,1866,1002,1762,1923
,1694,1807,1873,
1844,893,1752,1952,1815,1391,975,1925,894,1654,1
709,1868,1657,1735,1277,1715,1848,1009,1926,1710
,955,176
4,1874,1399,1468,1004,1494,1507,1439,1509,1929,1
819,1497,1658,1768,1876,1984,1010,1889,1717,957,
1821,983 ,1930,958,1739,1831,1498,1660,1718,1278,
1741,1599,1937,1822,1835,1403,987,1721,1455,1012
,1631,1513,999,1
890,1747,1510,1932,1742,1837,1500,1880,1863,1016
,1749,1722,1938,1776,1892,1843,767,1838,1463,195
3,989,15
14,1647,1695,1763,1940,1487,1867,1405,1521,1003,
1954,1845,1750,1985,990,1005,1896,1516,1655,1753
,1724,14
67,1765,1869,1944,1406,1846,959,1875,1754,1522,1
904,1766,1469,1495,1659,1956,1011,1711,1927,1849
,1524,10
13,1870,1769,1850,1756,1470,1986,1960,1499,1877,
1891,1661,895,1931,1006,1511,1719,1770,1852,1777
,1878,18
81,1528,1823,1279,1988,1933,1014,1743,1501,1939,
1017,1662,1772,1968,1893,1515,1723,1778,1882,150
2,1992,1
407,1934,1839,1018,2000,1894,991,1941,1751,1517,
1897,1725,1955,1780,1884,1523,1755,1020,1847,194
6,1898,1
942,1526,1957,1767,1784,1905,1007,1518,1726,1945
,1525,1900,1871,2016,1471,1757,1851,1958,1906,19
61,1987,
1771,1529,1879,1948,1758,1853,1015,1989,1962,190
8,1530,1773,1969,1990,1779,1883,1964,1854,1935,1
019,189
5,1663,1912,1503,1970,1774,1993,1532,1885,1781,1
994,1021,1943,1899,1886,1782,1972,2001,1947,1996
,1022,17
85,1901,1976,1519,1727,1959,2002,1907,1786,1527,
1949,1902,1759,2017,1909,1963,2018,2004,1950,178
8,1965,1
991,1910,1855,1971,1531,1913,2008,1775,1966,2020
,1995,1914,1533,1973,1997,2024,1916,1023,1974,18
87,1783,
2032,1534,2003,1977,1787,1998,1978,1903,2005,200
6,1951,2019,1789,1980,1911,2009,2021,2010,1967,1

915,202
2,1790,1535,2012,2025,1975,2026,1917,1999,1918,2
033,1979,2028,2034,1981,2007,1982,2011,2036,2023
,2040,17
91,2013,2027,2014,2029,1983,2035,2037,1919,2030,
2038,2041,2042,2015,2044,2031,2039,2043,2045,204
6,2047]

**Sequence group 4: Z4_2048**

[0,1,2,7,3,8,11,24,4,10,13,28,16,33,35,77,5,1
2,14,32,19,38,47,81,22,46,42,88,57,96,102,166,6,17,2
1,40,
23,45,51,90,29,55,59,97,72,110,116,184,34,61,75,114
,80,123,133,195,87,135,146,221,151,232,252,363,9,1
8,26,54,
30,58,71,105,36,76,62,117,84,127,140,204,44,74,86,1
34,92,143,150,227,100,153,168,244,182,260,277,402,
53,89,9
8,149,111,160,176,257,121,177,194,269,206,291,307,
433,137,202,224,297,230,308,331,462,249,339,357,4
83,376,5
04,541,725,15,25,31,73,39,79,82,139,48,85,93,148,10
1,158,163,254,56,94,103,161,115,175,191,272,126,19
2,203,2
86,226,304,326,451,64,108,122,181,128,193,209,299,
147,222,231,310,248,337,351,482,162,240,258,343,2
70,371,3
78,501,293,390,420,530,441,558,614,727,69,124,142,
212,157,229,247,341,167,250,263,362,278,377,401,5
21,189,2
73,287,387,309,412,437,568,322,444,467,592,489,62
4,644,819,208,300,316,424,344,450,471,607,375,479,
502,636,
532,648,700,874,399,512,542,675,553,715,737,915,6
11,751,773,908,799,951,1005,1192,20,37,41,91,49,95
,106,174 ,50,107,118,185,130,205,213,324,63,119,13
1,218,144,225,238,325,152,237,253,356,274,374,382,
500,67,141,154,2
20,171,241,259,372,179,267,279,384,290,409,428,55
0,178,288,302,408,321,438,453,593,346,473,490,623,
510,642,
680,859,78,165,172,265,188,284,301,403,196,306,31
4,435,332,460,477,621,251,327,345,465,364,487,509,
638,393,
516,546,672,571,712,740,902,283,359,385,497,407,5
29,548,702,431,564,578,724,615,762,782,939,468,61
3,625,77
4,639,801,766,965,689,851,875,1016,881,1081,1115,
1229,83,186,190,320,242,336,350,472,266,355,365,4
94,392,5
18,545,704,280,388,406,519,422,549,573,730,445,58
1,606,756,637,779,817,973,323,410,427,572,452,599,
629,768,
492,630,646,813,690,797,865,1022,527,666,708,853,
731,880,905,1058,763,911,910,1105,967,1127,1155,1
308,358,
442,474,631,517,647,679,829,547,703,717,876,748,8
87,909,1077,574,735,770,903,786,913,969,1129,827,
978,1001 ,1161,1040,1201,1226,1385,622,776,809,97
1,863,974,1030,1174,872,1026,1062,1215,1094,1247,
1294,1444,889,10
84,1123,1263,1146,1300,1278,1463,1189,1331,1352,
1516,1396,1544,1581,1667,27,43,52,99,60,120,132,2
10,66,13
6,145,217,156,235,239,368,68,155,164,234,173,285,2
94,398,198,296,319,432,334,455,475,634,70,170,187,
289,200 ,317,328,448,211,340,352,480,370,505,524,6
50,223,360,381,514,404,544,559,694,414,551,583,73
4,590,754,777,10
11,109,199,207,333,219,353,369,496,245,383,394,53
6,417,566,580,706,264,397,426,556,447,588,595,742,
464,597,
604,781,664,802,845,1024,281,446,458,602,486,627,
633,791,508,663,683,826,720,860,877,1065,535,699,
732,879,
764,900,943,1097,807,948,980,1130,1002,1165,1206,
1378,112,215,236,379,262,395,421,570,276,429,449,
598,469,
609,617,788,305,459,485,619,507,658,677,822,533,6
92,718,870,743,890,927,1068,329,495,523,681,560,7
09,707,8
93,575,736,752,916,793,945,957,1135,608,765,805,9
52,823,987,1004,1176,850,1020,1049,1216,1103,125
3,1297,1
451,348,540,565,738,594,761,795,949,655,806,834,9
97,838,1008,1037,1199,667,836,849,1029,897,1048,1
088,124
4,936,1100,1121,1264,1153,1314,1336,1470,693,907,
922,1071,962,1107,1126,1287,981,1151,1179,1328,1
207,1356 ,1391,1525,1053,1181,1219,1363,1260,140
2,1419,1571,1289,1435,1461,1591,1493,1628,1661,1
772,129,246,268,4
30,303,457,481,641,312,488,513,661,537,686,729,92
9,342,525,569,705,585,759,745,938,600,771,798,977,
830,991,
1014,1190,405,576,601,757,654,790,810,1000,660,83
3,843,1015,862,1038,1057,1233,668,856,884,1055,93
4,1087,
1117,1267,954,1143,1152,1319,1180,1337,1371,1509
,416,653,657,824,671,837,869,1044,698,898,919,107
9,946,11
12,1148,1303,804,931,964,1119,983,1162,1183,1333,
1041,1186,1222,1365,1262,1398,1415,1569,842,986,
1028,116
4,1054,1212,1236,1377,1092,1251,1272,1412,1301,1
437,1468,1607,1124,1292,1324,1460,1351,1484,1508
,1632,13
82,1519,1541,1656,1556,1693,1700,1831,425,673,68
5,925,789,941,956,1141,815,975,995,1169,1034,1195
,1231,13
73,847,1012,1051,1203,1075,1239,1275,1407,1114,1
298,1269,1429,1334,1465,1492,1613,937,1059,1086,
1255,113
3,1280,1321,1456,1159,1325,1350,1485,1369,1495,1
527,1651,1208,1359,1388,1513,1421,1548,1563,1681,1442,15
86,1604,1712,1629,1732,1736,1804,984,1089,1156,1326,1193,1346,1360,1504,1227,1395,1404,1536,1431,1549,15
93,1698,1235,1427,1458,1584,1490,1608,1611,1734,1521,1634,1647,1749,1674,1776,1791,1867,1306,1480,1486,1
624,1532,1636,1658,1755,1554,1680,1686,1786,1717,1792,1833,1888,1577,1709,1729,1814,1752,1819,1846,1909,
1765,1850,1864,1922,1878,1934,1943,1982,65,104,113,180,125,183,214,298,138,201,228,318,255,349,361,528,15
9,216,233,347,271,373,415,539,292,413,391,562,456,587,610,775,169,256,282,386,295,411,434,567,330,443,463,5
89,511,632,649,814,354,470,522,643,538,669,691,840,561,696,722,888,739,912,950,1131,197,261,313,440,335,46
1,506,616,366,526,476,651,554,676,711,855,400,520,557,695,579,716,733,899,603,744,780,930,812,961,993,1184,
439,563,591,728,635,755,796,958,662,800,839,982,858,1019,1045,1228,701,852,894,1027,904,1046,1080,1261,94
2,1093,1118,1286,1145,1312,1354,1534,243,311,338,515,380,534,543,710,418,555,582,726,605,753,767,955,454,5
84,612,758,645,794,831,988,674,832,854,1009,896,1039,1073,1249,484,626,665,811,678,835,866,1031,723,891,90
6,1050,940,1091,1109,1285,760,924,959,1099,985,1139,1149,1310,1021,1168,1209,1343,1237,1374,1432,1535,49
9,670,714,871,750,901,935,1096,778,944,966,1128,994,1147,1182,1335,825,989,1010,1166,1047,1200,1232,1383,
1067,1240,1268,1408,1295,1441,1462,1614,864,1032,1060,1213,1101,1248,1273,1424,1144,1282,1311,1452,1344,
1467,1512,1652,1178,1320,1355,1491,1370,1528,1546,1683,1428,1557,1575,1676,1597,1706,1742,1843,275,367,3
89,577,419,586,618,792,423,620,652,816,684,857,873,1070,478,656,687,883,719,895,921,1072,741,920,953,1116,
990,1142,1157,1309,493,713,746,886,784,926,960,1140,808,976,996,1160,1018,1197,1220,1367,803,1013,1035,11
96,1066,1234,1252,1409,1104,1276,1296,1440,1318,1459,1497,1642,531,772,785,970,821,1006,1033,1185,841,10
43,1056,1230,1082,1259,1281,1438,947,1074,1102,1266,1132,1291,1317,1454,1171,1327,1361,1488,1387,1526,15
50,1671,1003,1122,1163,1307,1194,1342,1364,1514,1224,1379,1397,1533,1433,1565,1583,1697,1270,1430,1443,1
576,1455,1598,1570,1715,1502,1639,1653,1748,1660,1784,1802,1861,552,818,828,1064,928,1090,1108,1274,972,
1113,1134,1302,1170,1330,1358,1517,998,1167,1191,1332,1211,1366,1390,1538,1241,1400,1423,1560,1453,1580,
1612,1720,1069,1198,1218,1389,1250,1416,1446,1572,1299,1447,1464,1609,1503,1595,1646,1751,1341,1481,152
3,1640,1539,1659,1673,1774,1566,1679,1678,1798,1716,1810,1824,1896,1120,1238,1277,1448,1329,1466,1496,16
20,1362,1515,1529,1654,1555,1663,1677,1782,1392,1543,1573,1672,1585,1682,1718,1811,1619,1724,1739,1827,1
762,1848,1859,1926,1439,1578,1605,1719,1645,1721,1758,1834,1650,1754,1777,1855,1794,1870,1889,1947,1664,
1785,1807,1876,1818,1892,1883,1953,1841,1904,1913,1969,1930,1977,1987,2008,315,396,436,596,466,659,688,8
67,491,697,721,882,749,917,923,1136,498,747,769,914,787,1007,1023,1177,844,1025,1063,1225,1085,1254,1279,
1450,503,783,820,1017,848,1061,1076,1245,868,1095,1110,1283,1138,1313,1339,1469,892,1125,1154,1323,1187,
1357,1375,1507,1202,1368,1401,1542,1406,1559,1579,1744,628,846,861,1083,885,1111,1137,1305,932,1158,1172 ,1348,1205,1381,1399,1520,968,1175,1217,1372,1243,1405,1411,1551,1265,1413,1422,1582,1479,1599,1633,1753 ,999,1242,1257,1420,1290,1445,1449,1590,1316,1478,1499,1618,1531,1643,1655,1778,1347,1511,1540,1657,1567 ,1670,1701,1795,1603,1704,1725,1812,1740,1830,1851,1924,640,878,918,1150,963,1173,1210,1386,992,1221,124
6,1414,1271,1426,1434,1587,1042,1258,1288,1436,1315,1475,1494,1615,1345,1505,1530,1649,1552,1665,1689,17
79,1078,1304,1338,1498,1376,1524,1522,1666,1393,1545,1558,1684,1592,1702,1711,1815,1425,1568,1601,1707,1
616,1731,1741,1835,1638,1750,1767,1856,1797,1872,1890,1948,1106,1353,1380,1547,1410,1564,1594,1705,1473,
1602,1623,1737,1627,1743,1760,1847,1482,1625,1637,1757,1668,1766,1789,1869,1694,1796,1806,1877,1823,189
7,1907,1956,1506,1675,1687,1780,1713,1799,1809,1885,1726,1821,1836,1903,1852,1914,1928,1972,1769,1838,18
57,1917,1874,1932,1938,1985,1886,1944,1952,1990,1963,1998,2007,2027,682,933,979,1223,1036,1256,1284,1457 ,1052,1293,1322,1477,1349,1501,1537,1690,1098,1340,1384,1518,1403,1562,1553,1696,1417,1574,1596,1723,162
1,1733,1746,1842,1188,1394,1418,1561,1472,1589,1606,1738,1476,1622,1631,1747,1644,1761,1773,1863

,1483,1641,1662,1771,1692,1788,1803,1879,1708,1817,1822,1898,1837,1908,1920,1967,1204,1471,1474,1617,1487,1626,1648,1764,1510,1669,1685,1783,1703,1800,1820,1894,1600,1691,1714,1805,1727,1828,1839,1905,1763,1840,1858,1918,1875,1931,1937,1984,1630,1730,1756,1829,1770,1854,1866,1923,1793,1871,1881,1936,1893,1945,1955,1993,1808,1887,1900,1951,1912,1958,1966,2000,1925,1970,1976,2005,1981,2013,2015,2035,1214,1489,1500,1688,1588,1699,1710,1816,1610,1722,1735,1832,1759,1845,1862,1921,1635,1745,1768,1849,1781,1868,1882,1935,1801,1891,1880,1941,1906,1954,1962,1996,1695,1775,1787,1873,1813,1884,1899,1949,1826,1901,1911,1959,1919,1964,1973,2004,1853,1915,1927,1968,1939,1978,1983,2011,1946,1989,1992,2017,1999,2020,2022,2032,1728,1790,1825,1902,1844,1910,1916,1965,1860,1929,1933,1975,1942,1979,1991,2014,1865,1940,1950,1988,1961,1994,1995,2021,1971,2001,2003,2023,2009,2028,2030,2040,1895,1957,1960,1997,1974,2002,2006,2025,1980,2010,2012,2029,2018,2031,2036,2042,1986,2016,2019,2033,2024,2034,2037,2043,2026,2038,2039,2044,2041,2045,2046,2047]

**Sequence group 4: Q4_4096**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1024,520 ,288,528,192,544,70,44,131,81,50,73,15,320,133,52,23,134,384,76,137,82,56,27,97,39,259,84,138,145,261,29,43,98,515,88,140,30,146,1025,71,262,265,2048,161,576,45,100,640,1026,51,148,46,75,266,273,517,104,162,53,193,1028,152,77,164,768,268,274,518,54,83,57,521,112,1032,135,78,289,194,85,276,522,58,168,139,99,86,60,280,89,290 ,529,524,196,141,1040,101,147,176,2049,142,530,321,31,200,90,1056,545,292,322,532,2050,263,149,102,105,304,296,1027,163,92,1029,47,267,385,546,324,2052,208,386,150,153,165,106,55,328,1088,536,577,548,1033,113,154,79,269,108,578,2056,224,166,519,552,195,270,1030,641,1041,523,275,580,291,59,169,560,114,277,156,87,1034,197,116,170,2064,61,1042,531,525,642,281,278,526,177,293,388,1152,91,584,769,198,2080,172,120,201,336,62,282,143,1036,1057,103,178,294,93,1089,644,202,2051,592,323,392,2053,297,770,107,180,1044,151,209,284,1280,648,94,204,298,400,608,2112,1058,352,325,533,155,210,305,2057,547,300,109,1048,184,534,1060,537,115,1031,167 ,225,326,2054,306,772,157,2065,656,329,110,117,212,171,1153,776,1090,330,1536,2058,226,549,1035,538,387,308,216,416,271,279,158,337,2066,550,672,1064,118,332,579,540,1092,2176,389,173,1154,121,553,199,784,179,228 ,338,312,1043,704,1037,390,174,554,581,1072,393,2060,283,2081,122,448,353,2113,561,1038,203,63,340,394,1096,1281,527,582,556,181,295,1045,285,232,124,2068,205,182,643,2304,1156,562,286,585,299,354,2082,1059,211,401,1282,185,1050,396,344,586,645,1537,593,535,240,2072,1104,206,95,327,2084,564,800,402,2055,356,307,301,417,1061,213,1049,568,1046,832,588,1160,1284,186,2177,646,404,2114,1288,227,896,594,418,2560,302,649,771,360,539,2059,111,1062,331,1538,214,309,1120,1091,2088,188,449,1065,217,408,609,596,2116,551,650,229,159,420,2178,310,1168,541,1052,773,610,657,333,1093,119,1066,2067,2061,600,339,1540,218,2096,368,652,1073,230,391,313,450,542,1098,334,1296,233,555,2062,774,175,123,1184,658,2120,612,341,2305,777,220,314,2069,1544,424,1312,395,673,583,355,1552,2180,1216,287,183,234,1568,125,557,1094,660,616,342,316,2083,1068,241,778,2306,563,2074,1155,345,452,397,2561,403,1105,207,2128,1074,674,558,785,1097,432,1039,357,187,1344,236,664,1157,624,587,780,1076,2085,1047,705,2073,126,242,2070,1158,565,398,2184,346,456,2308,358,405,303,569,2312,1408,244,1100,1161,595,1106,189,566,676,1080,1051,1121,361,2086,706,589,2562,1063,215,786,647,348,2144,2115,419,406,464,680,801,2089,1283,362,1108,590,409,1162,570,1169,788,1285,2192,1053,2076,597,1067,572,1122,219,311,2117,708,598,2090,1539,601,651,421,792,802,2564,611,1112,602,1164,410,231,2097,688,653,1054,248,1170,2122,369,2320,190,364,1095,654,2208,1286,659,1289,335,480,315,221,3072,370,1185,613,2568,1600,422,425,2336,451,1069,614,543,1124,235,412,2576,343,372,2240,1664,775,317,2592,2118,1075,222,1172,426,2092,453,237,1070,559,1099,2179,1290,833,804,712,1297,834,661,1541,808,779,2129,1128,617,604,2098,1186,433,72

0,2121,816,1077,2063,1217,836,2368,347,897,2181,1176,243,1101,2100,662,2071,1188,454,318,675,1792,618,2182,1292,898,781,1298,1542,376,428,1078,665,736,567,1107,2432,1081,1545,840,2124,2185,625,238,2130,1136,359,457,2104,399,787,2075,2145,591,678,434,677,2087,1159,1102,349,1313,1218,245,1109,458,666,1300,620,1546,1082,2307,1192,363,2132,127,1163,191,2186,1123,782,407,2193,436,626,2309,2077,1110,571,465,681,2091,246,707,2146,1084,350,1304,599,668,2563,1113,790,1314,1553,460,1548,2136,1220,249,2188,682,1165,573,1125,411,803,2078,1171,789,2194,1200,709,365,440,628,689,3073,2119,374,1166,423,2310,1554,466,793,2313,1345,250,371,1055,481,574,1224,2209,413,2624,1114,603,366,2093,1569,2148,1316,1346,468,1556,655,900,2688,805,615,3074,1287,684,1173,710,2099,1126,429,794,2196,252,1129,373,605,1328,848,690,2094,2123,713,632,2314,1320,482,806,2321,1187,2565,1116,427,2152,1071,904,2210,1291,414,1409,2101,223,1570,2241,1348,663,3076,692,835,1232,619,472,2200,1410,455,796,2125,1174,1177,809,714,2212,1189,721,837,2816,716,1130,2316,1079,1352,864,2322,2566,810,2102,1560,606,1601,2131,912,2105,2569,1572,722,696,377,1137,435,2160,1178,1103,817,1293,1132,319,621,1602,812,484,3080,1248,430,1190,2183,1543,2126,1576,838,2337,2242,667,1219,488,2133,1294,239,378,2324,2570,459,622,2106,2216,1665,627,437,2187,380,2147,1547,1299,818,1604,1315,461,2134,1083,496,669,1193,1584,679,1138,1301,2108,1180,724,2328,841,1111,629,2137,1221,351,467,2338,2577,1140,438,2572,2244,1194,737,251,462,2189,442,441,3088,2149,1085,469,2195,1555,247,683,2224,1549,1666,842,1305,1302,738,1550,2190,1201,899,2578,1317,670,1412,783,2369,1115,849,2079,1608,1793,820,2248,1222,728,928,2138,791,367,3104,2593,1196,901,1144,630,2340,2370,1225,685,844,2580,1360,633,711,1086,253,691,2311,1306,2197,824,2150,1167,902,686,2153,1127,1202,2352,1318,1117,740,1668,850,375,2344,1226,444,3075,1616,2211,470,1347,483,2140,1416,415,3077,485,2095,905,1321,795,473,2315,1794,634,744,2433,2594,1131,852,960,2372,1204,865,693,2256,1175,2434,1233,1308,797,2198,2201,1672,2213,1118,1228,906,1322,2154,715,1424,2103,2376,1632,807,3136,474,636,1376,694,254,2584,1349,1557,717,2625,1179,1234,575,913,2596,1329,798,811,3081,2161,379,1571,2202,1324,2127,1133,697,2317,2156,1208,431,2626,1558,607,2272,1561,2214,489,2567,2600,1139,866,723,2243,486,1191,2318,1249,1350,3078,908,1330,1796,718,813,2689,1181,476,856,3089,1680,1353,839,1134,2571,1141,2323,1236,725,2628,2339,698,1195,914,2107,1800,752,868,2217,2608,2162,819,2325,2204,1354,814,439,2135,929,3082,2245,1250,1573,490,2164,1562,1411,623,2218,1332,1240,671,1440,1295,739,1303,1182,2109,1361,916,3090,2579,1574,463,1696,843,2573,2690,1142,381,2329,2326,1356,1603,497,2574,2225,1564,930,821,2341,2436,726,961,3200,2139,1413,1197,872,2632,2817,1145,492,2246,1577,1223,631,1808,1203,729,2220,1252,2168,1362,700,2249,1336,443,1728,741,2384,1414,1198,2110,1578,1605,845,2330,1417,920,382,2191,3084,1307,822,3105,2151,1146,2226,851,1472,730,2342,2141,1377,498,3137,880,2692,1585,742,445,2250,1227,471,635,2640,1087,2371,1364,932,2440,1418,687,2345,1551,1606,2818,1580,1205,1319,903,2155,1309,825,2228,1256,1148,500,3092,1229,2199,846,1206,2257,2332,1667,745,3328,826,2696,732,1586,446,962,2142,2252,1310,1609,936,2346,2448,1323,475,853,2656,1378,867,637,3106,2400,1235,2373,1425,2581,1209,907,2203,2258,1420,1368,2353,1610,1669,487,1617,2595,695,1559,2348,2157,1264,746,3096,828,2232,753,1230,854,2582,1119,1351,3108,857,2585,1588,1824,504,799,2163,1426,2255,964,3079,2215,1380,909,1331,2273,1325,2374,1441,719,2354,2820,1237,477,2205,1592,915,2704,2377,1856,2158,2165 ,2260,1612,638,748,2219,944,1210,3201,2824,1670,1428,3138,869,1251,1920,491,699,2378,1618,1442,754,3584,1326,1673,858,1795,2274,1384,2597,1563,478,3083,2586,2435,968,1135,383,2356,2264,1355,910,2464,2319,2327,1238,815,2206,2385,1333,976,2598,2720,870,3112,2166,1212,1473,917,2380,2627,1241,1432,2588,1633,1620,3140,727,1575,1674,493,1253,2437,1183,2221,1444,873,3202,2169,1334,701,1565,931,2601,2247,1797,1634,2832,2227,1681,1357,756,2276,2386,1143,860,499,2360,3091,2752,731,3085,2438,1624,2222,1363,823,2602,262

9,1242,3
120,922,2441,1392,1676,874,2331,1254,1415,918,2170,1337,2496,1474,502,2401,1566,933,1358,2609,1257,1579,
3086,2251,1798,1199,1147,743,2111,2388,1682,760,2442,3144,1636,1365,881,3329,2575,1801,2630,494,1244,260
4,2229,2343,1338,702,3093,921,2333,1448,501,876,2280,2172,1419,847,2253,1697,2230,1607,992,2691,1379,447,
3204,2610,1311,1207,2334,1258,2633,1149,1581,733,2347,1684,1640,2402,1366,1340,827,3107,1265,2259,934,18
02,2449,3330,2233,1587,882,3098,937,2444,2392,963,1369,747,2634,2693,1476,1421,3585,505,2641,2583,1427,8
55,924,2288,1231,734,829,3152,2254,1698,1582,2143,1809,2375,1456,2612,2848,1381,1211,2450,1260,1688,965,
2404,1648,2355,1611,2349,2465,1804,938,3109,884,2261,506,1729,3097,2616,1150,1266,3094,749,2880,1589,142
2,945,966,2636,3208,1370,1480,755,3332,2234,1382,859,1429,2694,1327,2452,1593,940,3336,2275,2944,1268,83
0,2642,2466,1619,911,2350,2697,1213,2819,1590,2408,2587,1700,871,2159,639,1385,3110,2379,1730,1613,3586,
888,2262,1239,1810,479,2357,1671,1372,3168,946,3139,1443,1430,750,1488,2236,1704,2497,1825,969,3113,2265 ,2456,508,1386,861,2657,2644,1614,1433,2599,2698,2277,1594,757,2207,2468,1812,970,2358,3216,2589,3100,28
21,1621,2658,1596,919,2705,2381,1243,1335,3141,2167,1732,1622,3114,875,1625,1675,862,1445,2648,1816,2387 ,1826,758,3588,2266,1635,948,1626,2416,2700,1434,1255,3121,2278,2439,1712,1677,977,2361,2498,1272,923,25
90,3146,2382,1393,972,3344,2281,1214,2603,1388,2822,2223,2171,1678,3232,761,2706,1683,877,2660,2389,1359 ,1504,2825,1339,2268,1245,952,2362,1394,495,1637,3592,2472,1446,1449,3360,2443,1475,1638,1567,703,2721,2
631,1259,1436,2403,3600,1367,1396,935,3264,2335,1799,2231,978,1341,2282,3616,2173,2605,883,3142,762,2708 ,2664,1246,503,2390,2364,1450,3116,925,2289,1477,2826,1261,878,2611,1583,735,3203,2393,1857,1828,2500,17
36,2445,1858,1685,2451,1832,1803,3153,2255,1641,1628,993,3122,2722,1457,2606,1744,2833,3145,2480,1840,88
5,3087,939,2405,2235,994,1860,3392,2284,2712,1371,1921,3205,980,2672,2635,1267,926,764,2828,3124,1686,94
1,3095,2753,1478,1342,2174,1699,2290,1642,3206,2613,2446,1922,1805,2394,2504,1400,1452,967,2406,1689,245
3,1760,2351,2617,1591,886,3456,2292,831,1864,314
8,3209,2643,1649,1262,3154,947,2237,2614,1383,1481,507,2
724,3128,1423,1811,3099,889,3169,2409,1615,984,1702,2754,1458,2637,1701,751,3111,2263,2834,1373,942,2695 ,2396,1269,2467,2454,1482,2512,1690,2728,2849,1644,996,3331,2410,1387,3156,2638,1151,2457,1215,3210,971,
2618,1806,1431,3217,2836,1460,1650,3333,890,3101,1595,1489,509,1705,2645,3115,1270,2620,1731,949,3170,22
67,2359,973,1374,2756,2646,1623,1692,3587,2649,2699,2469,1814,1000,2840,2850,1484,892,2659,3160,2650,127
3,3212,2458,1706,2279,1597,2736,2701,1435,1827,3102,2296,1813,3218,950,2417,1733,1389,1464,2238,1652,241
2,1713,863,3143,2702,1398,759,1447,3334,2707,1490,1817,3337,2383,2528,1274,1395,1008,2363,2269,1505,1598 ,2418,3233,2661,1437,510,3648,2470,1627,2473,1390,2499,3117,2662,2591,3172,979,2283,2460,1492,953,2391,2
420,1679,1924,3712,2823,1829,2365,1639,763,1708,974,1734,3123,2270,1453,1818,3220,2474,1276,1397,1629,25
01,2285,1872,1714,3118,2607,3147,1737,1656,954,3338,2881,1506,2852,1830,2760,3345,2882,2709,879,3589,981 ,2856,2827,1451,3176,2665,2652,1928,3234,982,2481,2768,1438,927,2864,3125,1247,3265,2884,1687,1716,2395,
1859,2945,1643,1496,3224,2291,1479,1820,3149,2710,1833,1738,995,3236,2502,1745,2366,1861,2723,3840,2666,
1740,765,3340,2946,2829,956,1888,3346,3590,2424,2476,1834,3126,887,2713,2784,1630,985,2615,3155,1936,312
9,997,3593,2888,1746,1720,2673,1401,2286,1459,3184,2407,2505,1841,2447,2835,1343,1645,2639,1836,2726,150
8,2482,2725,1454,986,3207,3150,2397,1862,3361,3266,2293,1691,1512,3157,943,2506,2714,1263,1402,3348,2668 ,3594,1483,1646,3130,891,3240,2411,1651,998,1461,2175,3211,1404,2239,766,3171,2830,2455,1842,2484,2674,1
485,3158,2619,2513,1520,2729,1693,2294,2755,1703,511,3132,2398,1748,3352,2647,1865,2716,1653,3161,2838,1
375,1491,3362,3601,2508,1462,3596,988,3268,2297,1761,1275,1486,2730,3213,1466,2621,1465,1001,3173,2459,2
851,951,1493,3219,2837,1271,1707,3248,2757,2413,2488,1866,1002,2676,2737,1762,2422,3214,2471,1923,3602,2
514,1694,2841,1807,3393,2298,2419,1873,3103,2529,2622,1844,3272,893,2461,1752,1952,3162,2651,1815,2414,1
391,975,3617,1925,894,1654,3364,3394,2516,1709,1868,3604,2703,2948,1657,1735,2853,2663,1277,1715,3335,27 32,3221,2758,1848,1009,3174,2477,1926,2842,1710,2300,3177,2421,2653,3376,955,2896,2738,1764,2761,2680,1874,1399,3368,2530,2854,1468,1004,3235,1494,1507,3164,2475,1439,1509,3119,2952,1929,1819,1497,3339,2462,1658,1768,3457,2271,3618,1876,1984,1010,3396,2711,1889,2740,1717,2883,3280,2667,2520,957,3458,2503,2844,1821,3222,3225,2857,2762,3237,983,2769,2885,1930,958,2764,3178,1739,3127,3400,2912,1831,1498,1660,2858,1718,1278,3608,2654,1741,3649,2960,1599,1937,3620,2770,1822,2744,1835,2425,3185,2483,1403,987,3226,3151,2865,1721,3341,3180,2367,2669,1455,3650,1012,2860,2532,1631,3296,2478,3238,1513,3591,999,3624,2886,1890,1747,2715,3267,1510,2536,3342,2287,2426,1932,2507,2670,1742,1837,3713,2675,1500,2485,1880,2428,1863,1016,3595,3347,2866,1749,3652,3363,2509,1722,1938,3131,2544,2717,1776,1892,3241,3632,2727,3186,1843,3349,767,3228,2772,1838,1463,2889,3159,1953,2677,989,3269,2399,2515,1514,3188,2486,1647,3242,2785,2299,2510,1695,2490,2489,1763,3133,2517,1940,3603,2295,1487,2731,1867,3597,3714,2890,1405,3353,3350,2786,1521,3598,1003,3249,2947,1954,1845,3365,2718,3460,1750,2831,1985,990,3163,2897,1005,1896,3656,3841,2868,1516,3270,2776,2976,1655,2839,2415,1753,3244,2949,3192,2678,1724,3273,2733,1467,2892,1765,3408,2681,2759,3134,2301,2739,1869,3354,2872,1944,1406,3215,2950,2734,1846,959,3175,3250,1875,1754,3366,3165,2788,1522,1904,3716,2898,2423,1766,1469,3274,2492,1495,1659,3664,2518,3395,2531,1956,1011,3464,2463,1711,2533,2953,3369,2843,2521,3842,2682,2792,1927,3179,2900,3008,1849,3252,2913,2741,1524,1013,3223,1870,3281,3356,2845,1769,1850,3720,1756,1470,1986,3166,3276,2954,1960,3370,2763,3472,1499,1877,3680,2855,1891,2522,1661,2684,3424,2742,2302,895,3397,3605,2765,1931,3227,3282,2623,2961,3377,1006,2846,2859,1511,2427,3619,1719,3372,3181,2745,1770,1852,3256,1777,2479,1878,3606,2655,1881,3609,2537,1528,1823,3187,2914,1279,2771,1988,2534,3239,1933,1014,3297,3398,2956,1743,3378,3844,2766,2861,1501,3229,2524,2904,1939,3728,3401,2887,3182,3189,1017,3284,2773,1662,1772,2746,3243,1968,2962,3848,2800,2916,1893,2867,1515,1723,3402,2862,2487,1778,2977,1882,3298,3621,2538,1502,3610,3459,2671,1992,1407,3380,3288,2719,1934,3488,3343,2787,3351,1839,3230,1018,3409,2964,2000,3622,2511,3744,1894,2891,991,3190,2429,1941,3404,3651,2545,3612,2978,2869,1751,2774,3009,1517,3461,3245,2920,1897,3193,1725,2540,1955,3625,3271,2679,3856,3251,2777,1780,3300,3410,2748,1884,1523,3384,2491,3776,2789,1755,1020,3462,3246,1847,3626,3653,2893,1946,3465,2968,2430,1898,3355,2870,1942,3194,2899,3520,2778,1526,3425,2546,1957,2928,3633,2790,2493,3275,2519,2683,1767,3135,3412,2980,1784,3466,2735,1905,1007,3599,3654,1518,3628,3253,3367,2951,1726,1945,3357,2873,1525,1900,3304,3196,2548,1871,3277,2894,3254,2016,3715,2793,1471,2874,2780,3634,2494,3010,3358,3657,2984,1757,3371,2523,2901,3426,2915,2685,1851,3283,1958,3473,3257,2955,1906,1961,3468,3416,1987,1771,3658,3717,2535,1529,3665,2743,3607,1879,1948,3312,2794,1758,2876,1853,2801,3278,2902,1015,3167,3399,2905,3636,3872,2552,2847,3474,2303,3012,1989,3428,2957,3379,3373,3489,2767,1962,1908,3285,1530,2525,3640,2963,1773,3904,1969,1990,3660,2686,2796,1779,2992,3258,1883,3718,3476,2917,1964,3299,3968,2539,2747,1854,3666,3490,2802,1935,3374,3721,2906,3843,3432,1019,3611,2526,1895,3016,3183,1663,2431,3403,2958,1912,3286,2863,1503,3381,3024,1970,2918,1774,3260,3521,2965,1993,3289,3480,1532,1885,3681,3668,2775,3623,3722,2541,3301,1781,3231,3492,2921,1994,3382,2749,3613,2979,1021,3845,3682,1943,3729,3405,2804,3191,2908,2547,1899,2779,1886,3672,3411,2871,1782,3290,1972,2970,3440,3724,2922,3302,3463,2966,2001,3385,3522,2550,1947,3614,2981,3406,1996,1022,3305,3627,3846,3247,3195,2791,1785,3730,2808,1901,3684,3413,2929,3849,2542,3292,1976,3386,2750,1519,2969,3496,2549,2924,3467,2895,1727,3745,3655,3040,3427,2495,1959,3359,3255,2002,3306,3197,3629,2781,1907,1786,3732,3688,1527,3414,3388,2875,1949,3313,2982,3850,1902,3635,2930,1759,2985,3011,3417,2795,3524,3469,2553,3475,2903,2972,3279,2782,2877,2017,3746,3630,3857,3504,1909,1963,3429,3259,2018,3308,3736,3013,2004,3696,3659,1950,1

788,385
2,2986,2932,1965,2554,3777,3198,3314,2797,3637,3
470,2993,3014,3418,3528,2803,1991,3430,2907,3477
,3375,36
41,2988,1910,3316,1855,2878,3667,2959,1971,3261,
3638,1531,3748,2919,1913,2687,3433,2008,3778,366
1,2936,1
775,3287,3858,2527,1966,3719,3420,2994,3491,3478
,2798,3536,3752,3873,3017,2020,2556,3434,2909,36
62,3481,
1995,3642,2805,3860,3018,1914,1533,3669,3644,296
7,1973,3291,3383,1997,3780,3670,2923,3673,3723,2
910,349
3,2024,3864,3874,2806,1916,3683,2996,3674,1023,3
482,3303,3760,3725,3025,3320,2971,1974,3441,3020
,3262,34
36,1887,3726,1783,2809,3731,2925,3407,3552,2032,
3387,3293,3000,3442,2543,3685,1534,3494,3497,352
3,3686,3
615,2751,2003,3307,3484,1977,3415,3444,2983,3847
,3026,3389,1787,2931,1998,2810,3294,2551,3498,29
73,3525,
3309,2926,3631,2783,1978,3905,3876,3784,3906,373
3,1903,2005,3880,3851,3689,3676,3041,2006,3505,3
792,195
1,3888,2933,2987,3042,3908,3419,3969,3028,3315,2
974,2812,3734,2989,2019,3526,3390,3747,3690,1789
,3970,38
53,1980,3448,3500,3015,1911,3737,3808,2009,3639,
2934,2021,2879,3912,3697,3310,2995,3431,3529,255
5,3471,3
859,2937,3663,3032,3750,3506,3749,2799,2010,3421
,2990,3317,1967,3530,3738,3692,3044,1915,3435,20
22,3199,
3263,3019,1790,3854,3479,3508,3698,2938,3643,353
7,2557,3753,3318,3779,2997,1535,3021,3422,3671,3
740,386
2,3048,3532,2940,2012,3321,3754,3645,2025,3483,3
875,1975,3861,2998,3781,3437,3512,2026,3700,3761
,2911,34
46,2807,3495,3538,3865,3322,3443,3056,3553,3646,
1917,3485,2558,3675,3438,1999,1918,3027,3540,300
1,3727,3
972,3877,3687,2811,3756,3022,3782,2033,3501,3866
,3324,3445,3677,1979,3920,3762,3785,3704,3002,35
54,3878,
2028,2927,3029,3499,3976,3030,3486,2975,3295,203
4,3735,3764,3907,3691,3544,1981,3527,3868,3881,3
786,304
3,2007,3793,3909,1982,3788,2813,3004,3936,3882,2
935,3678,3033,3984,3045,3794,3768,3449,3507,2011
,3889,33
91,3693,2036,3884,3556,3502,3034,2023,3910,3739,
3560,2991,3311,3450,3531,3694,2939,3699,3046,350
9,3452,2
814,2040,3890,3533,3568,3741,3751,2559,1791,3796
,3913,3701,2013,3423,3539,3510,3036,3809,3323,35
34,3514,
3513,3049,2999,3541,3319,3755,3914,3050,3810,202
7,3971,3742,3855,2014,3921,2029,3892,2941,3800,4
000,386
3,3439,3023,3973,2942,3702,3757,3916,3705,3783,3
325,3763,3896,3057,3974,3758,1983,3003,3812,3922
,3447,35
16,3052,3542,3555,2035,3487,3557,3977,3867,3545,
3706,3816,3924,4032,3058,3937,3765,2037,3005,386
9,3031,3
978,3006,3787,3879,3546,3708,3766,3326,1919,3789
,3647,3985,2030,3870,3883,3451,3035,3769,3503,30
60,3679,
3561,3047,3938,3795,3558,2038,3980,3790,3885,354
8,3928,3911,3064,2041,3797,3770,3986,3824,3940,3
891,281
5,3886,3511,4001,3037,3562,3695,3743,3811,2042,3
988,3535,3915,2015,3453,3569,3051,4002,3893,3798
,4033,30
38,3053,3944,3564,3703,3801,3772,3515,3813,2044,
3917,3992,3454,3894,3007,3923,3802,3570,3952,381
4,3517,3
543,3707,4004,3059,3759,2031,3975,3897,3572,3061
,3918,3817,3898,3804,3518,4034,4008,3547,3925,39
39,3709,
2943,3979,3054,3559,3767,3818,3900,3825,3926,203
9,3929,3576,3871,3327,4036,3981,3062,3791,3549,3
987,306
5,3710,3820,4016,3941,3563,3771,3826,3930,2043,3
550,4040,3455,3982,3887,3066,4048,3942,3039,3989
,3799,35
65,3945,3773,4003,2045,3828,3932,3571,3803,3068,
3895,3994,3946,3990,3574,4005,2046,3815,3832,395
3,3055,3
566,3774,3993,3573,3948,3919,4064,3519,3805,3899
,4006,3954,4009,4035,3819,3577,3927,3996,3806,39
01,3063,
4037,4010,3956,3578,3821,4017,4038,3827,3931,401
2,3902,3983,3067,3943,3711,3960,3551,4018,3822,4
041,358
0,3933,3829,4042,3069,3991,3947,3934,3830,4020,2
047,4049,3995,4044,3070,3833,3949,4024,3567,3775
,4007,40
50,3955,3834,3575,3997,3950,3807,4065,3957,4011,
4066,4052,3998,3836,4013,4039,3958,3903,4019,357
9,3961,4
056,3823,4014,4068,4043,3962,3581,4021,4045,4072
,3964,3071,4022,3935,3831,4080,3582,4051,4025,38
35,4046,
4026,3951,4053,4054,3999,4067,3837,4028,3959,405
7,4069,4058,4015,3963,4070,3838,3583,4060,4073,4
023,407
4,3965,4047,3966,4081,4027,4076,4082,4029,4055,4
030,4059,4084,4071,4088,3839,4061,4075,4062,4077
,4031,40
83,4085,3967,4078,4086,4089,4090,4063,4092,4079,
4087,4091,4093,4094,4095]

**Sequence group 4: Z4_4096**

[0,1,2,7,3,8,11,24,4,10,13,28,16,33,35,77,5,12,14,32,19,38,47,81,22,46,42,88,57,96,102,168,6,17,21,40,23,45,51,90,29,55,59,97,72,111,117,187,34,61,75,115,80,124,134,199,87,136,147,226,152,238,259,382,9,18,26,54,30,58,71,105,36,76,62,118,84,128,141,208,44,74,86,135,92,144,151,232,100,154,170,250,185,267,286,425,53,89,98,150,112,161,179,264,122,180,198,278,210,302,320,462,138,206,229,308,235,321,346,494,256,355,375,519,395,544,588,818,15,25,31,73,39,79,82,140,48,85,93,149,101,159,165,261,56,94,103,162,116,178,195,281,127,196,207,296,231,316,340,482,64,109,123,184,129,197,214,310,148,227,236,323,255,353,367,518,163,246,265,359,279,390,398,541,304,412,445,575,471,609,678,820,69,125,143,217,158,234,253,357,169,257,270,381,287,397,424,565,193,282,297,409,322,437,466,621,336,474,501,650,527,689,716,943,213,311,330,451,360,481,506,668,394,514,542,704,577,721,786,1018,421,553,589,755,604,806,835,1077,673,852,881,1066,915,1125,1203,1490,20,37,41,91,49,95,106,177,50,107,119,188,131,209,218,338,63,120,132,223,145,230,244,339,153,243,260,373,283,393,403,540,67,142,155,225,173,247,266,391,182,276,288,405,301,434,456,600,181,298,314,433,335,467,485,651,362,508,528,688,550,712,762,997,78,167,174,273,191,294,312,426,200,319,327,464,347,492,512,686,258,341,361,499,383,524,549,707,415,559,595,751,624,803,839,1056,293,377,406,536,432,574,598,789,459,615,634,816,679,866,892,1108,503,676,691,882,708,917,872,1144,772,988,1019,1219,1030,1318,1369,1550,83,189,194,334,248,352,366,507,274,371,384,533,414,561,593,792,289,410,430,563,448,599,628,824,475,637,667,858,705,888,940,1156,337,435,454,627,483,659,696,874,531,697,718,934,773,912,1004,1229,572,742,798,990,826,1028,1061,1285,867,1070,1069,1356,1147,1390,1432,1688,376,472,509,699,560,720,761,956,596,790,808,1022,848,1037,1067,1312,629,832,877,1057,898,1074,1151,1393,953,1163,1199,1442,1256,1505,1544,1823,687,884,928,1153,1001,1158,1243,1463,1015,1236,1292 ,1529,1341,1583,1664,1935,1040,1323,1384,1609,1417,1675,1637,1972,1486,1728,1765,2076,1842,2132,2209,2406,27,43,52,99,60,121,133,215,66,137,146,222,157,241,245,387,68,156,166,240,175,295,305,420,202,307,333,460,349,487,510,702,70,172,190,300,204,331,343,479,216,356,368,515,389,545,569,723,228,379,402,556,428,592,610,777,439,601,639,831,648,856,885,1211,110,203,211,348,224,369,388,535,251,404,416,581,442,618,636,796,272,419,453,607,477,646,654,841,498,657,665,891,739,918,979,1232,290,476,490,663,523,693,701,904,548,738,765,952,811,998,1023,1296,580,785,827,1027,868,1053,1114,1345,925,1122,1166,1394,1200,1447,1516,1812,113,220,242,399,269,417,447,623,285,457,480,658,504,671,681,900,318,491,521,684,547,732,758,947,578,775,809,1013,842,1041,1092,1300,344,534,568,763,611,799,797,1044,630,833,854,1078,907,1118,1134,1402,670,869,921,1126,949,1176,1202,1466,987,1225,1270,1530,1353,1593,1670,1946,364,586,617,836,653,865,909,1123,729,924,962,1192,968,1207,1252,1501,743,965,986,1241,1049,1267,1331,1580,1104,1348,1380,1613,1430,1698,1736,1985,776,1065,1085,1303,1141,1358,1389,1650,1167,1426,1471,1722,1517,1772,1832,2092,1275,1475,1534,1782,1604,1853,1885,2189,1654,1920,1968,2234,2030,2312,2389,2668,130,252,277,458,315,489,517,711,325,526,554,735,582,769,823,1094,358,570,622,793,641,862,845,1107,660,878,913,1162,957,1182,1215,1487,429,631,661,859,728,903,929,1197,734,961,976,1216,1000,1253,1284,1559,745,994,1034,1280,1101,1328,1373,1619,1130,1413,1428,1705,1473,1737,1797,2063,441,727,731,950,749,966,1010,1261,782,1051,1082,1314,1119,1365,1421,1680,920,1097,1143,1378,1171,1443,1477,1732,1257,1482,1538,1786,1608,1844,1879,2185,973,1175,1240,1446,1276,1526,1566,1810,1337,1589,1628,1876,1676,1923,1982,2266,1386,1659,1715,1966,1763,2012,2060,2324,1819,2082,2128,2379,2158,2472,2484,2837,452,752,768,1089,901,1112,1133,1410,937,1160,1189,1455,1249,1495,1554,1801,982,1212,1272,1508,1308,1571,1632,1866,1368,1672,1624,1904,1733,1977,2029,2281,1105,1287,1327,1595,1399,1640,1709,1955,1438,1717,1761,2014,1792,2034,2097,2368,1519,1776,1828,2071,1889,2139,2176,2439,1932,2224,2256,2516,2316,2560,2574,2762,1172,1332,1433,1720,1491,1753,1777,2052,1548,1838,1857,2119,1909,2143,2236,2481,15
63,1900,
1960,2220,2025,2268,2277,2570,2086,2328,2357,260
3,2424,2677,2721,2947,1685,2002,2017,2302,2109,2
333,238
3,2623,2154,2435,2450,2710,2528,2724,2847,3024,2
200,2505,2550,2786,2614,2807,2878,3093,2647,2897
,2938,31
47,2986,3190,3225,3405,65,104,114,183,126,186,219
,309,139,205,233,332,262,365,380,573,160,221,239,3
63,280,
392,440,585,303,438,413,613,488,644,672,883,171,2
63,292,408,306,436,463,620,345,473,495,647,552,70
0,722,93
6,370,505,567,715,583,746,774,971,612,780,813,103
9,838,1073,1124,1396,201,268,326,469,350,493,546,
680,385,
571,511,724,605,756,802,993,423,564,608,778,635,8
07,830,1052,664,844,890,1096,933,1140,1187,1479,4
68,614,6
49,822,703,857,911,1136,737,916,969,1170,996,1224
,1262,1549,788,989,1045,1239,1060,1264,1317,1607,
1113,13
40,1376,1649,1416,1696,1769,2115,249,324,354,558,
401,579,591,801,443,606,638,819,666,855,873,1132,
486,640,
674,861,717,908,959,1178,754,960,992,1209,1048,12
55,1305,1586,520,692,741,931,760,964,1005,1244,81
5,1042,
1064,1271,1111,1336,1361,1648,864,1088,1137,1347
,1174,1408,1422,1692,1228,1454,1520,1749,1569,18
04,1912,
2117,539,748,805,1014,851,1055,1103,1344,886,111
7,1146,1392,1188,1419,1476,1735,951,1180,1210,14
50,1266,1
504,1558,1821,1299,1574,1622,1869,1665,1931,1971
,2284,1003,1246,1290,1527,1350,1584,1630,1894,14
15,1643,
1694,1949,1751,1981,2069,2371,1470,1707,1770,202
8,1796,2100,2136,2443,1903,2162,2198,2428,2244,2
498,258
6,2872,284,386,411,633,444,642,683,906,450,685,72
6,939,767,995,1017,1302,513,730,770,1033,810,1046
,1084,13
04,840,1083,1128,1372,1181,1412,1436,1691,532,80
4,846,1036,896,1091,1139,1409,927,1161,1190,1441,
1222,14
98,1536,1789,919,1214,1250,1496,1298,1562,1592,1
870,1355,1634,1669,1929,1704,1961,2038,2348,576,
880,897,
1152,946,1205,1247,1480,972,1260,1283,1553,1321,
1603,1641,1926,1121,1307,1352,1618,1398,1658,170
3,1953,1
459,1721,1780,2022,1826,2096,2144,2417,1201,1383
,1445,1687,1494,1748,1785,2074,1541,1813,1843,21
12,1914,
2179,2214,2480,1626,1908,1934,2199,1954,2245,218
8,2523,2050,2339,2372,2602,2387,2704,2757,2927,6
03,941,9
55,1295,1093,1335,1360,1631,1155,1367,1401,1679,
1458,1726,1775,2079,1193,1452,1489,1731,1524,178
7,1831,2
122,1575,1848,1893,2170,1950,2208,2280,2534,1301
,1500,1533,1830,1588,1880,1939,2190,1674,1940,19
75,2271,
2051,2240,2356,2612,1745,2005,2089,2341,2125,238
4,2422,2672,2180,2434,2432,2744,2527,2776,2817,3
048,137
9,1570,1636,1943,1725,1979,2037,2296,1781,2075,2
103,2376,2157,2396,2429,2698,1833,2131,2193,2418
,2223,24
40,2530,2779,2293,2540,2582,2826,2642,2887,2922,
3160,1927,2203,2259,2531,2353,2535,2630,2850,236
6,2621,2
681,2911,2729,2960,3027,3245,2400,2708,2770,2980
,2806,3036,3005,3270,2868,3079,3114,3345,3172,33
82,3433,
3557,328,418,465,656,500,733,771,1007,530,781,812
,1032,849,1080,1086,1404,537,847,876,1076,899,120
6,1231,
1467,978,1234,1294,1543,1326,1594,1639,1945,543,
894,944,1220,985,1291,1311,1581,1009,1343,1363,1
644,1407 ,1697,1741,1984,1043,1388,1431,1714,148
4,1774,1806,2059,1507,1791,1852,2130,1865,2167,2
204,2592,695,980,
999,1322,1035,1364,1405,1684,1099,1437,1461,1757
,1515,1817,1847,2085,1149,1464,1532,1800,1578,18
63,1874,
2147,1616,1877,1890,2212,2001,2246,2327,2617,119
6,1577,1599,1888,1657,1936,1944,2233,1701,2000,2
042,229
2,2108,2349,2377,2684,1755,2068,2126,2382,2182,2
414,2485,2733,2255,2494,2543,2780,2583,2832,2900
,3153,71
0,1026,1081,1425,1142,1462,1523,1825,1185,1537,1
582,1878,1627,1899,1918,2227,1259,1602,1653,1922
,1700,19
94,2033,2287,1752,2054,2105,2365,2148,2402,2460,
2689,1313,1682,1740,2040,1809,2091,2087,2405,183
5,2133,2
165,2444,2235,2489,2510,2789,1898,2184,2250,2499
,2288,2555,2585,2853,2337,2607,2655,2912,2741,29
66,3032,
3252,1357,1766,1816,2138,1873,2178,2237,2495,199
1,2254,2301,2577,2311,2589,2638,2882,2007,2305,2
336,262
7,2409,2651,2718,2957,2474,2736,2766,2985,2816,3
057,3087,3281,2056,2427,2453,2692,2519,2746,2775
,3016,25
44,2813,2857,3075,2901,3118,3165,3355,2660,2860,
2916,3125,2975,3181,3206,3420,3020,3232,3267,345
0,3312,3
498,3544,3695,764,1100,1165,1539,1251,1598,1647,
1958,1274,1662,1710,1997,1760,2047,2121,2462,134
6,1743,1
822,2080,1856,2174,2153,2478,1882,2194,2241,2539,2297,2564,2596,2869,1485,1837,1884,2171,1989,22
31,2261,
2581,1996,2300,2322,2598,2351,2639,2671,2936,201
1,2345,2393,2666,2470,2714,2761,2989,2504,2802,2
814,306
4,2858,3089,3137,3338,1511,1988,1993,2290,2018,2
307,2361,2646,2064,2412,2449,2700,2490,2753,2809
,3041,22
49,2466,2522,2765,2548,2827,2862,3083,2644,2865,
2918,3128,2979,3173,3202,3418,2317,2553,2626,283
0,2661,2
909,2945,3150,2725,2964,2997,3200,3037,3235,3278
,3469,2771,3023,3070,3266,3112,3300,3336,3505,31
57,3348,
3381,3538,3401,3593,3599,3778,1528,2023,2046,245
7,2228,2483,2508,2798,2275,2538,2573,2841,2635,2
877,293
1,3141,2331,2593,2656,2891,2695,2950,3000,3193,2
756,3033,2993,3220,3084,3274,3311,3479,2475,2675
,2713,29
68,2785,3008,3066,3258,2822,3071,3111,3301,3132,
3316,3359,3533,2904,3120,3163,3342,3208,3386,341
3,3573,3
242,3443,3463,3617,3501,3640,3649,3744,2549,2720
,2818,3074,2874,3104,3121,3329,2926,3169,3185,33
76,3224,
3389,3452,3598,2941,3216,3261,3440,3308,3470,347
6,3646,3351,3508,3529,3664,3566,3699,3721,3824,3
045,329
5,3304,3493,3370,3511,3540,3673,3397,3570,3579,3
717,3625,3723,3782,3858,3426,3611,3634,3753,3668
,3766,37
96,3883,3688,3804,3820,3903,3841,3919,3931,3987,
108,164,176,271,192,275,313,431,212,299,329,461,3
72,497,5
16,747,237,317,342,496,396,529,590,759,422,587,55
7,794,645,829,860,1098,254,374,407,551,427,584,61
6,800,47
0,632,655,834,719,893,922,1159,502,669,740,910,75
7,942,977,1194,791,983,1024,1273,1047,1306,1362,1
651,291,
378,449,626,478,652,714,871,522,744,675,923,783,9
58,1008,1223,566,736,787,981,817,1016,1038,1286,8
50,1054,
1106,1334,1154,1382,1434,1742,625,795,837,1031,8
95,1072,1131,1375,935,1135,1191,1411,1227,1469,1
512,1811,
991,1218,1279,1488,1293,1513,1568,1872,1351,1591
,1633,1917,1678,1964,2039,2385,351,446,484,725,53
8,753,7
66,1006,594,784,821,1029,853,1068,1087,1370,643,8
25,863,1075,914,1129,1183,1420,954,1184,1221,145
6,1282,1
506,1560,1854,682,887,938,1150,963,1186,1235,149
3,1025,1277,1297,1518,1349,1587,1617,1916,1079,1
325,1377 ,1601,1414,1667,1683,1959,1474,1713,178
4,2016,1834,2072,2181,2388,709,945,1012,1242,106
3,1289,1342,1597,
1102,1354,1391,1646,1435,1681,1739,1999,1177,142
3,1457,1708,1514,1764,1820,2094,1552,1840,1887,2
141,193
0,2202,2239,2546,1233,1497,1540,1794,1605,1851,1
896,2166,1677,1911,1962,2221,2020,2248,2340,2633
,1734,19
78,2041,2295,2062,2364,2403,2697,2173,2426,2464,
2687,2511,2751,2836,3102,400,525,555,814,597,828,
875,112
7,602,879,926,1164,970,1226,1245,1556,677,930,974
,1265,1020,1281,1320,1557,1050,1319,1366,1629,14
24,1673,
1693,1957,698,1011,1058,1269,1115,1329,1381,1668
,1145,1403,1439,1699,1468,1758,1802,2057,1138,14
60,1502,
1756,1551,1824,1858,2142,1610,1901,1933,2201,197
4,2232,2306,2610,750,1095,1116,1397,1173,1451,14
99,1744,
1195,1510,1531,1815,1572,1868,1907,2196,1359,156
1,1606,1883,1652,1925,1973,2225,1719,1987,2048,2
289,209
9,2360,2408,2679,1449,1638,1702,1951,1754,2015,2
053,2343,1807,2084,2111,2381,2183,2447,2479,2735
,1891,21
77,2205,2465,2226,2513,2454,2774,2320,2599,2634,
2851,2645,2949,2996,3154,779,1168,1179,1547,1330
,1585,16
15,1897,1400,1625,1655,1942,1718,1992,2045,2346,
1440,1711,1750,1995,1790,2055,2102,2392,1841,211
6,2164,2
437,2222,2473,2542,2788,1555,1759,1799,2101,1855
,2152,2211,2456,1938,2213,2243,2533,2321,2507,26
19,2861,
2010,2278,2354,2601,2394,2643,2683,2915,2448,269
1,2690,2982,2778,3012,3052,3257,1635,1836,1902,2
215,199
0,2247,2304,2562,2049,2344,2369,2636,2421,2654,2
688,2943,2104,2399,2459,2680,2488,2694,2782,3014
,2559,27
94,2831,3059,2889,3115,3149,3358,2197,2468,2525,
2784,2616,2790,2875,3078,2631,2867,2921,3135,296
7,3179,3
240,3431,2658,2953,3007,3199,3040,3248,3219,3455
,3099,3288,3317,3519,3371,3552,3595,3694,455,562,
619,843 ,662,932,975,1237,694,984,1021,1263,1062,
1315,1324,1661,706,1059,1090,1310,1120,1453,1478
,1730,1204,1483,
1546,1808,1576,1860,1905,2218,713,1110,1169,1465
,1213,1542,1564,1849,1238,1596,1620,1913,1666,19
65,2006,
2252,1278,1642,1690,1983,1746,2044,2073,2329,176
8,2058,2120,2398,2137,2433,2469,2844,889,1208,12
30,1573,
1268,1621,1663,1948,1338,1695,1723,2027,1778,209
0,2114,2350,1395,1729,1798,2067,1846,2134,2146,2
411,188
1,2150,2161,2477,2274,2514,2588,2864,1444,1845,1
864,2159,1924,2207,2217,2497,1970,2273,2310,2558,2374,26
11,2637,2925,2026,2338,2395,2641,2451,2676,2740,
2971,2521,2748,2796,3015,2833,3063,3123,3349,902
,1254,13
16,1686,1387,1724,1788,2098,1429,1803,1850,2151,
1892,2169,2187,2492,1509,1867,1921,2192,1969,226
5,2299,2
552,2021,2325,2370,2628,2413,2659,2716,2930,1565
,1947,2004,2308,2077,2355,2352,2664,2106,2401,24
30,2699,
2501,2743,2760,3022,2168,2452,2518,2752,2554,280
5,2835,3081,2597,2856,2902,3136,2978,3187,3244,3
439,161
2,2036,2088,2404,2145,2446,2503,2749,2262,2520,2
568,2824,2575,2840,2885,3110,2279,2571,2595,2873
,2670,28
99,2958,3176,2731,2974,3004,3201,3050,3265,3293,
3462,2326,2686,2707,2934,2769,2984,3011,3231,279
7,3047,3
086,3285,3124,3321,3365,3528,2907,3090,3140,3328
,3196,3378,3400,3584,3234,3421,3453,3607,3490,36
51,3687,
3811,967,1339,1406,1805,1503,1862,1915,2230,1522
,1928,1980,2270,2031,2315,2391,2719,1600,2008,20
95,2347,
2124,2442,2416,2734,2155,2461,2509,2793,2563,281
2,2848,3100,1747,2107,2156,2438,2260,2496,2526,2
829,226
9,2567,2584,2849,2615,2886,2914,3159,2282,2606,2
650,2910,2728,2956,2999,3205,2755,3035,3049,3273
,3088,32
94,3339,3512,1773,2258,2264,2556,2286,2572,2625,
2894,2335,2673,2703,2946,2745,2992,3043,3251,251
7,2723,2
773,3002,2800,3060,3092,3290,2890,3096,3144,3331
,3198,3373,3395,3582,2580,2804,2871,3062,2908,31
31,3164,
3347,2963,3184,3212,3392,3249,3423,3460,3626,300
9,3238,3280,3451,3315,3481,3510,3655,3354,3522,3
549,368
2,3565,3725,3732,3874,1795,2291,2314,2712,2493,2
738,2759,3031,2537,2791,2821,3069,2881,3106,3156
,3341,25
91,2845,2905,3117,2940,3168,3215,3385,2995,3246,
3209,3412,3291,3457,3489,3632,2732,2917,2955,318
9,3019,3
222,3276,3446,3056,3282,3314,3482,3335,3492,3531
,3677,3126,3324,3362,3516,3403,3556,3575,3710,34
29,3602,
3622,3745,3652,3767,3771,3846,2801,2959,3053,328
3,3103,3307,3325,3504,3151,3369,3380,3543,3415,3
558,360
9,3730,3162,3410,3448,3600,3487,3627,3630,3769,3
524,3657,3672,3786,3703,3815,3832,3912,3255,3475
,3483,36
45,3537,3659,3684,3792,3563,3709,3715,3827,3750,
3833,3876,3935,3590,3741,3763,3856,3789,3862,389
0,3956,3
803,3894,3909,3969,3924,3981,3991,4030,690,870,9
05,1148,948,1157,1248,1492,1002,1217,1288,1545,1
371,1614 ,1645,2013,1071,1258,1309,1611,1418,167
1,1771,2035,1472,1767,1716,2081,1861,2129,2172,2
467,1109,1374,144
8,1706,1481,1762,1814,2093,1567,1839,1875,2135,1
976,2216,2251,2536,1623,1895,2003,2238,2032,2283
,2323,25
78,2078,2332,2378,2657,2407,2693,2750,3017,1198,
1385,1525,1829,1579,1871,1967,2186,1656,2009,190
6,2253,2
065,2298,2359,2605,1738,1998,2070,2330,2113,2367
,2397,2674,2160,2415,2476,2722,2532,2768,2819,30
94,1827,
2083,2140,2390,2219,2436,2506,2763,2272,2512,257
6,2799,2609,2855,2895,3152,2342,2600,2665,2870,2
682,289
6,2948,3197,2739,2965,3001,3230,3039,3263,3319,3
541,1333,1521,1590,1986,1689,2024,2043,2358,1779
,2066,21
18,2386,2163,2431,2455,2758,1859,2123,2175,2441,
2242,2502,2565,2808,2294,2566,2604,2842,2669,288
8,2937,3
182,1919,2206,2276,2529,2303,2569,2620,2876,2380
,2662,2685,2903,2737,2962,2988,3229,2445,2711,27
64,2973,
2803,3029,3044,3260,2859,3068,3127,3303,3166,334
3,3416,3542,1956,2285,2363,2629,2425,2678,2730,2
970,247
1,2742,2777,3013,2820,3042,3091,3292,2557,2810,2
843,3065,2898,3113,3158,3356,2929,3170,3207,3387
,3241,34
28,3454,3633,2618,2879,2919,3133,2976,3180,3213,
3407,3038,3226,3262,3441,3305,3459,3515,3678,308
5,3275,3
320,3488,3337,3532,3554,3712,3411,3567,3588,3705
,3614,3738,3777,3887,1427,1660,1712,2110,1783,21
27,2191,
2500,1793,2195,2257,2541,2313,2608,2632,2933,191
0,2263,2318,2649,2373,2667,2706,2935,2410,2705,2
754,299
8,2811,3034,3054,3259,1941,2362,2419,2653,2486,2
715,2767,3030,2524,2792,2823,3058,2854,3108,3142
,3333,25
15,2846,2883,3107,2928,3161,3186,3388,2981,3217,
3243,3427,3272,3449,3495,3666,2019,2463,2487,278
3,2551,2
838,2880,3095,2579,2893,2913,3155,2951,3195,3223
,3424,2747,2939,2977,3204,3018,3237,3271,3444,30
73,3284,
3326,3485,3361,3530,3559,3700,2834,3006,3061,325
6,3105,3302,3330,3517,3146,3350,3372,3539,3417,3
577,359
7,3729,3210,3414,3430,3589,3445,3615,3583,3748,3
502,3662,3679,3785,3686,3825,3844,3906,2061,2545
,2561,29
24,2717,2961,2987,3214,2787,2994,3021,3250,3072,
3287,3323,3520,2825,3067,3101,3289,3130,3332,336

4,3546,3171,3375,3406,3571,3442,3594,3631,3754,2932,3109,3139,3363,3183,3396,3434,3585,3247,3435,3456,3628,3503,3612,3671,3788,3299,3477,3526,3663,3547,3685,3702,3813,3578,3708,3707,3839,3749,3852,3867,3943,3003,3167,3218,3436,3286,3458,3494,3641,3327,3518,3534,3680,3564,3690,3706,3822,3366,3551,3586,3701,3601,3711,3751,3853,3639,3758,3774,3870,3800,3892,3904,3973,3425,3591,3623,3752,3670,3755,3795,3877,3676,3791,3816,3899,3835,3915,3936,3995,3691,3826,3849,3922,3861,3939,3929,4001,3885,3951,3960,4017,3977,4025,4035,4056,1535,1727,1818,2149,1886,2267,2319,2622,1937,2334,2375,2648,2423,2701,2709,3025,1952,2420,2458,2696,2491,2839,2863,3082,2587,2866,2923,3148,2954,3188,3221,3438,1963,2482,2547,2852,2594,2920,2942,3177,2624,2969,2990,3227,3028,3264,3297,3461,2663,3010,3051,3279,3097,3322,3344,3509,3116,3334,3377,3550,3384,3569,3592,3780,2210,2590,2613,2952,2652,2991,3026,3254,2726,3055,3076,3310,3122,3353,3374,3523,2781,3080,3138,3340,3175,3383,3391,3560,3203,3393,3404,3596,3474,3616,3656,3790,2828,3174,3192,3402,3236,3432,3437,3606,3269,3473,3497,3638,3536,3667,3681,3817,3309,3514,3548,3683,3580,3698,3733,3836,3621,3736,3759,3854,3775,3873,3895,3971,2229,2640,2702,3046,2772,3077,3129,3360,2815,3143,3178,3394,3211,3409,3419,3603,2892,3194,3233,3422,3268,3468,3491,3635,3306,3506,3535,3675,3561,3692,3719,3818,2944,3253,3296,3496,3346,3527,3525,3693,3367,3553,3568,3713,3608,3734,3743,3857,3408,3581,3619,3739,3636,3765,3776,3878,3661,3787,3806,3900,3838,3917,3937,3996,2983,3318,3352,3555,3390,3576,3610,3737,3466,3620,3644,3772,3650,3779,3798,3891,3478,3647,3660,3794,3696,3805,3830,3914,3726,3837,3848,3923,3866,3944,3954,4004,3507,3704,3716,3819,3746,3840,3851,3932,3760,3864,3879,3950,3896,3961,3975,4020,3808,3881,3901,3964,3920,3979,3985,4033,3933,3992,4000,4038,4011,4046,4055,4075,2309,2727,2795,3145,2884,3191,3228,3447,2906,3239,3277,3472,3313,3500,3545,3720,2972,3298,3357,3521,3379,3574,3562,3728,3398,3587,3613,3757,3642,3768,3783,3886,3098,3368,3399,3572,3465,3605,3624,3773,3471,3643,3654,3784,3669,3799,3812,3908,3480,3665,3689,3810,3724,3829,3845,3925,3740,3860,3865,3945,3880,3955,3967,4015,3119,3464,3467,3637,3484,3648,3674,3802,3513,3697,3714,3823,3735,3842,3863,3941,3618,3722,3747,3847,3761,3871,3882,3952,3801,3884,3902,3965,3921,3978,3984,4032,3653,3764,3793,3872,3809,3898,3911,3970,3834,3916,3927,3983,3940,3993,4003,4041,3850,3934,3947,3999,3959,4006,4014,4048,3972,4018,4024,4053,4029,4061,4063,4083,3134,3486,3499,3718,3604,3731,3742,3859,3629,3756,3770,3875,3797,3889,3907,3968,3658,3781,3807,3893,3821,3913,3928,3982,3843,3938,3926,3989,3953,4002,4010,4044,3727,3814,3828,3918,3855,3930,3946,3997,3869,3948,3958,4007,3966,4012,4021,4052,3897,3962,3974,4016,3986,4026,4031,4059,3994,4037,4040,4065,4047,4068,4070,4080,3762,3831,3868,3949,3888,3957,3963,4013,3905,3976,3980,4023,3990,4027,4039,4062,3910,3988,3998,4036,4009,4042,4043,4069,4019,4049,4051,4071,4057,4076,4078,4088,3942,4005,4008,4045,4022,4050,4054,4073,4028,4058,4060,4077,4066,4079,4084,4090,4034,4064,4067,4081,4072,4082,4085,4091,4074,4086,4087,4092,4089,4093,4094,4095]

**Sequence group 4: Q4_8192**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1024,520 ,288,528,192,544,70,44,131,81,50,73,15,320,133,52,23,134,384,76,137,82,56,27,97,39,259,84,138,145,261,29,43,98,515,88,140,30,146,1025,71,262,265,2048,161,576,45,100,640,1026,51,148,46,75,266,273,517,104,162,53,193,1028,152,77,164,768,268,274,518,54,83,57,521,112,1032,135,78,289,194,85,276,522,58,168,139,99,86,60,280,89,290 ,529,524,196,141,1040,101,147,176,2049,142,530,321,31,200,90,1056,545,292,322,532,2050,263,149,102,105,304,4096,296,1027,163,92,1029,47,267,385,546,324,2052,208,386,150,153,165,106,55,328,1088,536,577,548,1033,113 ,154,79,269,108,578,2056,224,166,519,552,195,270,1030,641,1041,523,275,580,291,59,169,560,114,277,156,87,1034,197,116,170,2064,61,1042,531,525,642,281,278,526,177,293,388,1152,91,584,769,198,2080,172,120,2

01,336,6
2,282,4097,143,1036,1057,103,178,294,93,1089,644,
202,2051,592,323,392,2053,297,770,4098,107,180,10
44,151,2
09,284,1280,648,94,204,298,400,608,2112,1058,352,
325,533,155,210,305,2057,4100,547,300,109,1048,18
4,534,10
60,537,115,1031,167,225,326,2054,306,772,157,2065
,656,329,110,117,212,171,1153,776,1090,4104,330,1
536,205
8,226,549,1035,538,387,308,216,416,271,279,158,33
7,2066,550,672,1064,118,332,579,540,1092,2176,389
,173,115
4,121,553,199,784,179,228,4112,338,312,1043,704,1
037,390,174,554,581,1072,393,2060,283,2081,122,44
8,353,21
13,561,1038,203,63,4128,340,394,1096,1281,527,582
,556,181,295,1045,285,232,124,2068,205,182,643,23
04,1156,
562,286,585,4099,299,354,2082,1059,4101,211,401,1
282,185,1050,396,344,586,645,1537,593,535,240,207
2,1104,
206,95,327,2084,564,800,402,2055,4160,356,307,301
,417,1061,213,1049,568,1046,832,4105,588,1160,128
4,186,2
177,646,404,2114,1288,227,896,594,418,2560,302,64
9,771,360,539,2059,4102,111,1062,331,1538,4113,21
4,309,1
120,1091,2088,188,449,1065,217,408,609,596,2116,5
51,650,229,159,4106,420,2178,310,1168,541,1052,77
3,610,6
57,333,1093,119,1066,2067,4114,2061,600,339,1540,
218,2096,368,652,1073,230,391,313,4224,450,542,10
98,334,
1296,233,555,2062,774,175,123,1184,658,2120,612,3
41,2305,777,220,314,2069,1544,424,1312,395,4108,6
73,4129 ,583,355,1552,2180,1216,4161,287,183,234,
1568,125,557,1094,660,616,342,316,2083,1068,241,7
78,2306,563,207
4,1155,345,452,397,2561,4116,403,1105,207,2128,10
74,4352,674,558,785,1097,432,1039,357,187,1344,23
6,664,1
157,624,4130,587,780,1076,2085,1047,705,2073,126,
242,2070,1158,565,398,2184,346,456,2308,4120,358,
405,303 ,569,2312,1408,4132,244,1100,1161,595,110
6,189,4103,566,676,1080,1051,1121,361,2086,706,58
9,2562,1063,215 ,786,647,348,2144,2115,419,406,46
4,680,4225,801,2089,4162,1283,362,1108,590,409,11
62,4608,570,1169,788,12
85,2192,1053,4107,2076,597,1067,572,1122,219,311,
2117,708,598,2090,1539,601,651,421,792,4136,802,2
564,611 ,
1112,602,1164,410,231,2097,4164,688,653,1054,248,
1170,2122,4226,369,2320,190,364,1095,654,2208,12
86,659,
1289,335,480,4115,315,4109,221,3072,370,1185,613,
2568,1600,4144,422,425,2336,451,1069,614,543,112
4,235,41
2,2576,343,372,2240,1664,775,317,2592,4110,2118,1
075,222,1172,426,4168,2092,453,4353,237,1070,559,
1099,21
79,1290,4117,833,804,712,1297,834,661,1541,808,77
9,2129,1128,617,604,2098,1186,433,4228,720,2121,8
16,1077 ,2063,1217,836,2368,347,897,2181,1176,413
1,243,1101,2100,662,4354,2071,1188,4122,454,318,6
75,1792,618,218
2,1292,4609,898,781,1298,1542,376,428,1078,665,41
76,736,567,1107,2432,1081,1545,840,2124,2185,625,
238,213
0,1136,359,457,2104,399,787,2075,2145,4133,591,67
8,434,4121,677,2087,1159,4118,1102,349,1313,1218,
245,423
2,1109,458,4356,666,1300,620,1546,1082,2307,1192,
4360,363,2132,127,1163,191,2186,1123,782,407,219
3,436,62
6,2309,2077,1110,571,465,681,2091,246,4134,707,21
46,4610,1084,350,1304,599,668,2563,1113,4192,416
3,790,13
14,1553,460,1548,2136,1220,4137,249,2188,682,116
5,573,1125,411,803,2078,1171,789,2194,1200,709,36
5,4240,4
40,628,4124,689,3073,2119,374,1166,423,2310,1554,
4165,466,793,2313,4138,1345,250,371,1055,481,574,
1224,22
09,4612,413,2624,1114,603,366,2093,1569,4145,214
8,1316,1346,468,1556,655,900,4170,2688,805,4368,6
15,3074,
1287,684,1173,710,2099,1126,4256,429,794,2196,25
2,1129,373,605,1328,848,690,2094,5120,2123,713,63
2,2314,1
320,482,4616,806,2321,4384,1187,2565,1116,427,21
52,1071,904,4624,2210,1291,4288,414,1409,2101,22
3,1570,4
640,2241,1348,4166,663,3076,692,835,1232,619,472,
2200,1410,4140,455,796,2125,1174,1177,809,714,22
12,1189,
721,4227,837,2816,716,1130,2316,1079,1352,864,23
22,2566,4177,810,2102,1560,4146,606,1601,2131,91
2,4169,2
105,2569,1572,4111,722,696,377,4416,1137,435,216
0,1178,4229,1103,817,1293,1132,319,621,4148,1602,
812,4119 ,484,3080,1248,430,1190,2183,1543,2126,1
576,4230,838,2337,2242,667,1219,488,2133,1294,23
9,378,2324,2570,4
59,622,2106,2216,1665,4480,627,437,2187,380,4172,
4233,2147,1547,4178,1299,818,1604,1315,461,4152,
2134,10
83,4123,496,4193,669,1193,1584,679,1138,1301,210
8,1180,4135,724,2328,841,1111,629,2137,1221,351,4
67,2338,
2577,1140,438,2572,2244,1194,737,251,4355,462,21
89,442,4180,441,3088,2149,4234,1085,469,2195,155
5,4241,2
47,683,2224,1549,4357,1666,4125,842,1305,1302,73
8,4139,1550,2190,1201,4194,899,2578,1317,670,141
2,783,23

69,1115,4611,849,2079,1608,1793,820,2248,1222,728,928,4184,2138,791,4236,367,3104,2593,1196,901,1144,630,
2340,2370,1225,4126,685,844,2580,4242,1360,633,711,1086,253,691,2311,1306,5121,2197,4167,824,2150,1167,902,4358,686,2153,1127,4361,1202,2352,1318,1117,740,6144,1668,850,375,4257,2344,1226,4672,444,3075,1616,2211,470,1347,4141,483,2140,1416,4196,415,3077,485,2095,905,1321,795,473,2315,1794,4736,634,744,2433,5122,
2594,1131,852,960,2372,1204,865,4147,693,2256,4244,1175,2434,1233,1308,797,2198,2201,1672,4142,4171,2213 ,1118,1228,4362,906,1322,2154,715,1424,4369,2103,2376,1632,4613,807,3136,474,636,4200,1376,694,254,2584,1349,4258,1557,717,2625,1179,1234,575,913,4149,2596,1329,798,4289,811,3081,5124,2161,379,1571,2202,1324,2127,1133,4248,697,2317,2156,4173,1208,431,2626,1558,4260,607,2272,1561,2214,489,4864,2567,2600,1139,4364 ,866,723,2243,486,4370,1191,4614,2318,1249,4150,1350,3078,908,1330,1796,718,813,4179,2689,1181,4153,476,4617,856,3089,1680,1353,839,1134,2571,1141,2323,1236,4208,725,2628,2339,698,1195,914,2107,1800,752,868,2217,2608,5128,2162,819,2325,2204,1354,4231,814,4174,439,2135,929,4385,4290,3082,2245,1250,4181,1573,490,2164,1562,4372,1411,623,4618,2218,1332,4154,1240,4264,671,1440,1295,739,1303,4235,1182,2109,1361,4195,916 ,3090,2579,1574,463,1696,843,2573,2690,1142,4182,381,2329,2326,1356,1603,497,2574,2225,1564,930,821,4156,
2341,2436,726,4376,961,3200,2139,1413,4185,1197,872,2632,2817,1145,4386,4625,492,2246,1577,4620,1223,4292,631,1808,1203,729,4237,2220,1252,5136,2168,1362,4197,700,2249,1336,443,4243,1728,741,2384,1414,4272,1198,2110,1578,1605,845,2330,6145,1417,920,382,4238,2191,3084,1307,4626,822,3105,2151,1146,2226,851,1472,4417,730,2342,2141,1377,4127,498,3137,880,2692,4296,1585,742,445,2250,1227,4186,471,635,2640,1087,5152,2371,1364,4641,932,2440,1418,687,4388,4418,2345,1551,4628,1606,2818,1580,1205,1319,903,6146,2155,1309,4359 ,825,4245,2228,1256,1148,4198,500,3092,1229,2199,846,1206,4201,2257,2332,1667,4400,745,3328,826,2696,732,
1586,446,962,2142,2252,1310,4392,1609,936,2346,5123,2448,1323,475,853,4259,2656,1378,867,4188,637,3106,5125,2400,4143,1235,2373,1425,2581,1209,4363,907,2203,2258,1420,4481,1368,4642,2353,1610,1669,4420,487,6148,1617,2595,695,1559,4304,2348,2157,1264,4482,746,3096,828,2232,753,4246,1230,4249,854,2582,1119,4261,1351,3108,857,2585,1588,1824,504,799,4202,2163,1426,4151,255,4424,964,3079,5184,2215,1380,909,1331,2273,1325,2374,1441,4632,719,2354,2820,4673,1237,477,2205,1592,4644,915,2704,2377,1856,5129,2158,4209,2165,2260,1612,4250,638,4175,748,2219,944,4365,1210,4204,3201,2824,1670,4674,1428,3138,869,6152,1251,4320,1920,491,699,4262,2378,1618,4615,1442,4648,754,3584,1326,1673,858,1795,4291,2274,1384,2597,1563,4366,478,3083,
2586,5126,2435,968,1135,383,2356,2264,1355,4737,910,2464,2319,5137,2327,1238,815,2206,2385,1333,4619,976 ,4371,2598,2720,870,4676,4387,3112,2166,1212,4155,1473,917,2380,2627,1241,4265,1432,4656,4210,2588,1633,
4373,1620,3140,4252,727,1575,1674,493,1253,4183,2437,1183,5130,2221,1444,4293,873,3202,2169,1334,701,4212,1565,931,2601,2247,1797,4266,1634,2832,2227,1681,1357,756,2276,6160,2386,1143,860,499,4157,2360,3091,5138,2752,4627,731,3085,2438,1624,2222,4621,1363,4738,823,2602,2629,1242,4377,4374,3120,922,2441,1392,4622,1676,4273,874,2331,1254,4389,1415,918,4484,2170,1337,5248,2496,1474,4187,502,2401,1566,933,4680,1358,4865,2609,1257,4294,1579,3086,2251,1798,1199,1147,743,2111,6176,2388,1682,4268,760,4216,2442,3144,1636,1365,4297,881,3329,2575,1801,2630,494,1244,4432,2604,2229,2343,1338,4158,702,3093,921,2333,4378,1448,501,876,2280,2172,1419,4239,5132,847,2253,1697,5153,2230,1607,4199,992,4274,2691,1379,447,4390,4189,3204,5185 ,2610,1311,4740,1207,2334,1258,2633,1149,4298,1581,733,6147,2347,1684,4688,1640,4419,2402,1366,1340,4488 ,827,3107,6149,1265,2259,934,1802,4393,2449,3330,2233,1587,4866,882,3098,937,2444,2392,963,1369,4203,747,
2634,2693,1476,4276,1421,3585,505,2641,5140,2583,1427,855,924,4247,2288,1231,4305,734,4380,829,3152,5376 ,2254,1698,4744,1582,2143,1809,2375,1456,4190,4300,2612,2848,1381,4394,1211,4496,2450,1260,1688,4704,965 ,6208,2404,1648,5154,2355,1611,4448,2349,2465,1804,4421,938,4629,3109,884,2261,506,4251,1729,4306,3097,2616,1150,4401,1266,3094,749,2880,6153,1589,1422,945,966,4643,2636,3208,1370,4396,1480,4205,755,3332,5144 ,2234,1382,859,1429,4280,2694,1327,2452,1593,4630,940,3336,2275,5156,2944,4633,1268,830,2642,2466,1619,4 211,911,2350,2697,1213,5127,2819,1590,4263,2408,2587,1700,4321,871,4422,6150,2159,639,4402,1385,4868,311
0,2379,1730,4253,1613,3586,888,6161,2262,1239,4752,1810,4425,479,4206,2357,1671,4213,1372,3168,4308,946,
3139,1443,1430,750,1488,4267,2236,1704,5249,2497,1825,4872,969,3113,2265,5186,2456,508,1386,861,2657,264
4,1614,4426,1433,2599,2698,5632,2277,1594,757,2207,6154,2468,1812,4322,970,4645,2358,3216,5131,2589,4634 ,4483,3100,2821,1621,2658,4404,1596,4312,919,2705,2381,1243,4512,1335,4367,3141,4375,2167,1732,4254,1622 ,3114,4433,875,6162,1625,4646,1675,862,1445,4768,2648,1816,5160,2387,1826,4214,758,3588,2266,1635,948,44
28,1626,4675,2416,2700,1434,4636,1255,3121,2278,5188,2439,1712,1677,977,2361,6272,2498,1272,4485,923,426
9,2590,3146,5250,2382,1393,4217,972,3344,2281,1214,2603,4649,1388,4295,2822,2223,2171,1678,4880,4275,323
2,761,2706,4324,1683,4434,877,2660,2389,1359,4408,1504,5139,4800,2825,1339,5133,2268,1245,4486,952,4270,
2362,1394,495,4650,1637,4677,3592,5168,2472,1446,4489,1449,3360,2443,1475,6156,1638,4379,1567,703,2721,6
177,2631,1259,4218,1436,4544,2403,3600,1367,1396,4449,935,3264,6209,2335,1799,2231,978,1341,4657,2282,36
16,2173,5134,2605,4299,883,3142,762,2708,2664,4159,1246,4436,503,2390,2364,1450,4490,5192,3116,925,2289,
1477,5377,2826,1261,4623,878,4678,2611,1583,4652,735,4277,4391,3203,5141,2393,1857,4381,1828,2500,1736,2
445,1858,4328,1685,4220,6164,2451,1832,4301,1803,3153,4278,2255,1641,1628,4739,993,3122,6400,2722,1457,5
252,2606,1744,4658,2833,3145,2480,1840,4382,885,4681,3087,939,2405,2235,994,1860,4395,3392,2284,2712,137
1,4450,1921,3205,980,2672,6178,5155,2635,1267,926,764,4307,2828,3124,1686,4497,5378,4281,941,3095,5146,2
753,1478,4492,1342,4440,2174,1699,2290,1642,4682,4741,3206,2613,5633,2446,1922,4689,1805,4631,2394,2504,
1400,4336,1452,967,6168,2406,1689,5200,2453,1760,4302,2351,2617,1591,4191,886,4423,3456,6180,2292,831,46
60,1864,4896,3148,3209,2643,1649,4498,1262,3154,947,2237,6151,2614,1383,1481,4452,507,4403,2724,3128,142
3,4397,1811,3099,4513,889,3169,5157,2409,1615,984,1702,4309,2754,1458,5145,2637,1701,4664,751,3111,2263,
5142,2834,4928,1373,942,2695,2396,1269,4684,5256,2467,2454,1482,5380,2512,1690,4282,2728,6273,2849,1644,
4742,996,4500,6210,3331,5384,2410,4323,1387,4992,3156,2638,1151,2457,4690,1215,4514,3210,971,6656,2618,1
806,4398,1431,4745,3217,4867,2836,1460,4456,1650,3333,4635,890,3101,6155,1595,1489,509,1705,4207,2645,31
15,1270,5158,2620,1731,4427,949,3170,2267,5634,2359,973,1374,4310,2756,2646,1623,4405,1692,3587,2649,521
6,2699,5187,2469,1814,1000,2840,6184,2850,1484,4284,892,4545,2659,3160,5161,2650,1273,4313,4504,3212,245
8,1706,2279,4705,1597,4692,6212,2736,2701,1435,4647,1827,4746,3102,4325,2296,4255,1813,3218,4516,950,627
4,2417,1733,4406,1389,5264,1464,4637,2238,1652,5148,2412,1713,4869,863,4706,3143,2702,1398,759,4753,1447 ,4429,3334,5189,2707,1490,4215,1817,3337,2383,5162,2528,6163,1274,1395,1008,2363,6157,2269,1505,4696,159
8,4435,2418,3233,5636,2661,1437,4314,510,3648,6192,2470,1627,2473,4464,1390,4748,2499,3117,2662,5169,259
1,4326,4487,3172,979,2283,2460,4409,1492,4546,953,2391,2420,1679,4638,1924,5194,3712,4430,2823,1829,5392 ,2365,1639,4329,763,4651,6158,1708,4870,974,4271,1734,4219,3123,5280,2270,1453,4754,1818,3220,2474,1276,
6216,1397,4708,1629,4437,2501,6401,2285,1872,4873,1714,3118,4316,2607,3147,1737,1656,4410,954,3338,6165,
2881,1506,5640,2852,1830,4520,2760,3345,2882,5408,2709,4491,879,3589,981,2856,2827,4769,1451,4679,3176,2
665,2652,1928,4451,5648,3234,982,2481,6276,5312,2768,1438,4383,927,4279,2864,3125,1247,4330,5664,4221,46
53,3265,5190,2884,1687,4756,1716,4712,2395,1859,2945,1643,4438,1496,4412,3224,6179,5164,2291,1479,4337,1
820,3149,4874,2710,6402,1833,4659,1738,995,3236,6170,2502,1745,5251,2366,1861,4441,2723,3840,2666,1740,4
548,765,4493,3340,6657,2946,2829,956,1888,4499,3346,3590,2424,5201,2476,4303,1834,3126,887,2713,6224,278
4,5170,1630,4770,985,4654,2615,3155,1936,4881,5193,3129,4528,997,3593,5135,2888,1746,4453,1720,4283,2673 ,1401,5440,2286,1459,4332,4760,3184,2407,5253,2505,4720,1841,4683,2447,2835,1343,4876,1645,5172,6181,263
9,1836,5143,2726,1508,4801,2482,6169,2725,1454,4222,986,4338,3207,6166,3150,5254,2397,4661,1862,4494,336
1,3266,2293,1691,6280,4442,1512,4552,3157,943,25

06,6404,2714,1263,1402,4454,3348,4501,2668,3594,1483,439 9,1646,3130,4665,891,3240,6408,5504,2411,1651,99 8,1461,4340,2175,3211,1404,5196,2239,5257,4691,7 66,3171, 2830,5202,2455,4285,1842,4662,2484,2674,1485,477 2,5176,3158,2619,5147,2513,1520,5217,2729,1693,4 457,229 4,6182,2755,1703,4802,511,4685,6658,3132,5159,23 98,1748,4311,4882,3352,2647,1865,2716,4743,1653,4444,316 1,6240,6211,2838,1375,4515,1491,4502,3362,3601,4 560,2508,4776,1462,3596,4897,988,3268,6185,2297,1761,127 5,5379,1486,4458,2730,3213,1466,5204,2621,1465,4 686,1001,4505,3173,2459,5258,2851,951,1493,4666,3219,526 5,2837,1271,4884,1707,3248,2757,5381,2413,6288,5 149,2488,1866,1002,2676,6172,2737,1762,4693,5163 ,4668,24 22,3214,5218,2471,1923,4315,4407,3602,6213,2514,1694,2841,4804,1807,4694,6186,3393,2298,5635,241 9,4697,1 873,4747,3103,4517,2529,2622,4888,1844,4898,3272 ,893,6660,2461,1752,4707,1952,5208,3162,4698,265 1,1815,5 260,2414,1391,4506,975,4327,3617,6193,1925,894,4 784,1654,4749,3364,3394,5150,2516,1709,4344,1868 ,3604,27 03,5266,2948,6218,1657,1735,4465,2853,6416,2663,1277,4286,1715,3335,4460,2732,3221,5191,2758,184 8,4750,1 009,3174,6304,2477,1926,5382,2842,1710,4755,2300 ,3177,2421,5385,2653,4431,4576,3376,955,2896,273 8,4411,1 764,4317,7168,2761,2680,1874,4466,1399,5281,3368 ,4709,2530,6664,5696,2854,1468,4518,1004,4521,64 32,3235, 1494,4547,5165,4710,1507,4639,3164,5220,2475,143 9,4331,1509,4508,3119,2952,1929,6672,1819,4439,1 497,446 8,3339,6336,5760,2462,1658,4871,1768,3457,4413,2 271,3618,6688,1876,1984,1010,3396,6214,2711,1889 ,5171,27 40,1717,4318,2883,3280,2667,5268,2520,4522,957,3 458,6188,2503,2844,4549,1821,4333,3222,3225,2857 ,5166,27 62,4655,5195,3237,983,2769,6275,2885,5386,1930,4 929,958,4900,2764,3178,1739,4808,5393,3127,4930,4757,340 0,5637,2912,1831,4904,1498,4875,6225,1660,5224,2 858,1718,4713,1278,4700,3608,6194,5282,2654,4529 ,1741,36 49,4816,2960,6217,1599,4912,1937,5173,3620,6159,2770,1822,5313,2744,1835,4932,2425,6464,3185,248 3,1403,4 443,987,4993,3226,6277,3151,5272,2865,1721,4339,3341,3180,2367,5197,2669,6196,4758,1455,3650,101 2,2860,6 167,2532,5284,1631,4550,3296,4414,2478,3238,1513 ,4771,5888,3591,4714,999,3624,6278,5388,2886,189 0,4994,1 747,4877,2715,3267,1510,5394,2536,5638,4472,4524 ,3342,2287,5174,2426,4761,1932,4832,2507,2670,17 42,4663, 1837,5203,3713,6528,5177,2675,1500,5641,2485,188 0,4936,2428,6220,6281,1863,4721,1016,4334,3595,6 226,334 7,5232,2866,1749,4455,4553,3652,3363,2509,1722,6 200,4495,1938,4883,3131,6171,2544,6241,2717,1776 ,1892,46 87,3241,3632,4774,2727,3186,4530,1843,3349,4773,767,3228,6183,2772,5255,1838,5198,1463,4445,2889 ,3159,19 53,5409,2677,5314,4341,989,3269,2399,5205,2515,4 554,1514,4762,3188,5396,2486,1647,4716,5642,3242 ,2785,51 78,2299,6403,5288,2510,1695,4459,2490,6228,2489,1763,4223,5259,4287,6282,3133,5219,2517,1940,487 8,4503,3 603,6289,2295,1487,2731,4532,1867,4722,3597,6405 ,3714,6173,5206,2890,4667,1405,4561,3353,3350,47 77,2786, 6187,4342,1521,4803,3598,1003,3249,6242,2947,195 4,1845,5180,3365,4446,2718,3460,1750,5400,2831,1 985,469 5,990,4764,3163,6659,5209,2897,1005,1896,4886,36 56,3841,5410,2868,5649,4556,1516,3270,2776,5644,2976,623 2,5316,1655,4345,2839,6284,2415,1753,4778,5261,3 244,4669,2949,3192,5221,2678,1724,4507,4899,3273 ,6174,27 33,1467,5267,2892,1765,4885,6290,3408,2681,5296,2759,4805,4461,3134,4536,2301,2739,4724,1869,478 5,3354,7 169,6215,2872,1944,4470,1406,5262,3215,4519,2950 ,6406,5650,2734,1846,4562,959,4889,3175,6409,325 0,1875,5 441,4346,1754,4467,3366,3165,5151,2788,1522,4577 ,1904,4670,3716,2898,5320,2423,6305,1766,1469,45 09,3274, 6720,5210,2492,1495,4699,1659,3664,4462,2518,339 5,6189,5665,2531,1956,1011,3464,6244,2463,1711,5 412,253 3,5442,4564,2953,3369,2843,5652,2521,4751,4996,3 842,6784,2682,2792,4901,1927,4711,7170,3179,2900 ,5383,30 08,4780,1849,5269,3252,4806,2913,6195,2741,5222,1524,4525,1013,4890,6292,3223,1870,4348,5225,328 1,4469,4 701,3356,5424,2845,1769,4944,1850,4786,3720,6190 ,1756,6219,1470,4809,1986,4728,3166,3276,6410,54 16,2954, 4578,1960,3370,4902,2763,3472,6417,1499,1877,528 3,3680,6661,2855,1891,5212,2522,1661,4523,2684,6 248,342

4,2742,5167,2302,5000,895,3397,6306,3605,5387,2765,1931,4510,3227,3282,2623,5505,2961,6197,4319,5666,3377,1006,2846,6337,2859,5444,1511,4759,7172,4788,2427,3619,1719,4931,5328,3372,4715,4568,3181,6296,5506,2745,1770,4551,1852,4892,6221,3256,1777,5270,2479,5273,4905,1878,4810,3606,6308,5285,2655,4817,1881,4933,3609,2537,6912,1528,4812,1823,5226,3187,6412,5175,2914,1279,5448,2771,1988,4960,2534,6418,3239,6662,1933,1014,4906,3297,6198,3398,5656,2956,1743,4702,3378,3844,2766,5697,2861,6227,5008,1501,3229,6201,2524,6665,2904,5668,1939,4818,3728,3401,4792,2887,3182,4473,5233,3189,4531,1017,3284,6256,2773,5274,1662,5199,1772,4913,2746,3243,1968,5389,2962,5228,4415,4717,3848,2800,5698,2916,4908,1893,4580,7176,5344,2867,1515,4526,1723,5286,3402,6279,5639,2862,6222,5672,2487,1778,4934,2977,6433,6338,1882,4763,5315,4584,3298,6229,3621,5390,2538,1502,4335,4474,3610,6420,3459,2671,1992,6666,4555,1407,4718,3380,6202,3288,6312,5761,2719,1934,4723,3488,3343,4533,2787,3351,6283,4476,1839,3230,1018,3409,6243,2964,5643,2000,5395,3622,4914,2511,3744,1894,5700,2891,5411,4557,991,3190,6230,5179,2429,4592,1941,4765,3404,3651,5289,2545,5680,4775,5234,3612,2978,5397,2869,6204,5276,1751,4820,2774,6424,3009,1517,4937,5207,3461,4725,6233,3245,5317,2920,1897,4447,4563,3193,6434,6673,1725,5236,2540,1955,4534,3625,6668,3271,6340,5290,2679,4833,4347,3856,3251,4558,2777,6285,4538,1780,4537,3300,7184,3410,6245,2748,1884,1523,5181,3384,4565,2491,6291,3776,5651,2789,1755,4343,1020,4779,3462,6320,3246,5645,5762,1847,4938,3626,3653,5401,2893,5398,4834,1946,3465,2968,5646,2430,6286,5297,1898,4995,3355,6674,5413,2870,1942,4766,5508,3194,4879,2899,3520,6465,5211,2778,1526,4945,3425,6175,2546,1957,5704,2928,5889,4916,6344,3633,2790,5318,2493,4824,5024,3275,6234,2519,2683,4887,1767,4463,3135,7200,3412,6689,5292,2980,4997,1784,5240,3466,4726,2735,6436,6466,5321,1905,4781,1007,4940,3599,6676,3654,1518,5456,3628,4729,4807,3253,3367,5182,2951,1726,4349,1945,4787,3357,6407,5402,2873,6293,1525,1900,4920,3304,3196,6246,5263,2548,4998,1871,3277,4782,2894,3254,6249,5223,2016,5298,3715,6448,2793,1471,5414,2874,5213,4836,2780,3634,2494,5764,3010,4946,4471,3358,6440,3657,5322,2984,1757,4540,7171,3371,2523,5712,2901,6307,4566,5443,3426,4579,2915,6236,2685,5512,1851,4511,7173,4581,6191,3283,1958,5001,5417,3473,4891,4569,3257,6411,5890,2955,1906,4730,1961,4840,3468,6529,3416,1987,6690,5227,4948,1771,5056,3658,3717,6468,5300,2535,4961,1529,4789,3665,2743,3607,6352,1879,1948,5271,3312,6530,5329,2794,1758,5404,2876,1853,4893,2801,6294,3278,6297,5768,2902,1015,3167,6309,3399,5214,2905,5324,5002,3636,3872,2552,5418,2847,6250,4811,5520,3474,6199,2303,6472,3012,5728,1989,4903,7232,3428,4570,2957,3379,4732,5472,3373,4790,4350,3489,6680,2767,5445,1962,5653,1908,4813,6721,3285,1530,5275,2525,5330,4671,5009,3640,6692,5425,2963,4894,1773,4907,3904,7177,6257,1969,4475,1990,5667,3660,6298,5420,2686,6223,5229,2796,1779,4793,2992,6413,3258,6252,1883,5304,4527,3718,6722,3476,5654,2917,1964,4703,3299,6368,3968,2539,5657,2747,6310,4585,1854,3666,6663,3490,6696,5235,2802,1935,4962,3374,3721,4819,2906,3843,6339,4582,5287,3432,1019,3611,6414,2526,5345,1895,5446,7174,5004,3016,3183,1663,5426,2431,5892,4814,4909,3403,6785,5277,2958,4572,1912,4952,7185,3286,5776,2863,5449,4935,1503,5230,3381,6667,5237,3024,6419,5332,1970,4821,2918,6724,6435,1774,4794,5291,3260,5010,6203,3521,5896,2965,1993,4848,4964,3289,6313,3480,6704,1532,6258,1885,4915,3681,6421,3668,6300,5450,2775,4910,3623,3722,4535,2541,3301,6231,5025,1781,3231,7178,3492,6341,2921,5346,1994,5669,3382,4586,2749,6260,3613,5658,2979,5507,4719,1021,3845,6314,3682,5428,5336,1943,4767,3729,3405,5536,2804,5391,4835,5399,3191,2908,5278,2547,6205,5457,1899,5012,7186,6675,5670,2779,1886,4559,5792,3672,4939,6669,3411,6786,5238,2871,1782,4477,3290,6425,6422,1972,5452,2970,5699,4593,3440,6670,3724,6321,5660,2922,5026,4917,3302,6437,3463,2966,6532,4822,2001,5057,3385,7296,3522,6235,5509,2550,1947,5293,3614,4968,2981,6728,3406,6913,5241,1996,1022,4588,3305,6342,3627,5673,5319,3846,4727,3247,3195,5904,2791,5299,48 25,1785,3730,6316,5348,2808,6264,5458,1901,4796,3684,3413,6345,5432,2929,4539,5824,3849,4837,2542,3292,6480,5510,1976,5294,3386,6206,2750,1519,5674,2969,5701,4941,6426,3496,2549,5513,2924,5016,4478,3467,6287,7180,5403,2895,1727,4918,3745,7201,3655,6247,5242,3040,6322,4947,5568,3427,4826,2495,6438,6237,5473,1959,4594,7233,4976,3359,6788,3255,2002,5681,3306,4838,4541,3197,6346,3629,5323,2781,1907,4567,1786,4731,3732,6736,3688,5183,6467,5460,1527,5028,3414,3388,6536,5514,2875,4783,1949,3313,2982,3850,6441,5647,1902,5702,3635,6914,5676,2930,1759,5301,2985,5415,4999,3011,3417,6251,5405,2795,4921,3524,6324,3469,5352,2553,5244,4596,7188,3475,2903,5325,2972,6295,4942,5302,3279,6353,2782,6428,2877,5763,2017,4841,7424,3746,4922,6792,3630,4828,5682,3857,4542,5058,3504,6238,6348,5406,1909,5705,1963,5032,3429,6442,3259,2018,6544,5419,4571,4949,3308,3736,6752,5474,3013,4963,2004,4733,3696,7202,3659,6496,1950,1788,5331,3852,6469,5521,2986,6677,5305,2932,1965,5003,2554,6299,3777,6354,5516,5464,3198,6449,3314,5706,2797,5765,4583,3637,3470,2993,5713,3014,6691,4791,5655,3418,6444,3528,6253,5360,2803,1991,4842,7192,3430,4924,2907,3477,6328,4849,5326,3375,4950,3641,6678,2988,5215,1910,5447,7204,4953,6681,3316,1855,5684,2878,5920,4600,4895,3667,6259,5522,2959,4351,1971,5060,3261,7175,3638,6311,5476,5005,1531,5427,3748,6369,5421,2919,6470,5537,1913,4815,2687,6450,3433,6916,2008,5333,3778,4573,6301,3661,5688,2936,1775,5011,3287,6800,3858,6473,5952,2527,6254,1966,3719,6261,3420,6356,5708,2994,4734,3491,3478,4844,2798,3536,6315,5040,5306,3752,7297,3873,6920,3017,5766,2020,5524,7234,4965,2556,3434,5347,2909,6016,4587,4795,3662,6474,3481,5714,5538,1995,4850,7680,3642,5422,2805,5769,4954,5891,3860,6370,5480,3018,6693,5659,1914,4574,7179,6682,6531,1533,5064,5231,3669,4479,6452,3644,6360,5451,2967,1973,5006,3291,6560,3383,6415,1997,6423,5334,4911,3780,6302,3670,6481,5429,2923,5072,3673,6694,3723,2910,3493,6816,4966,2024,3864,7208,3874,6262,5308,2806,1916,5569,3683,5013,2996,6476,3674,6723,5337,5528,1023,3482,6684,3303,5729,5716,7236,4823,3760,3725,5671,3025,5770,4589,5349,3320,6533,5279,2971,6317,5540,1974,4969,7298,3441,6265,5430,3020,4797,5661,3262,5027,6697,3436,6343,5893,1887,5730,3726,6928,6323,1783,5777,2809,5453,4852,6372,3731,6482,5239,2925,4956,4595,3407,6456,3552,7187,6848,2032,4827,3387,7181,3293,6534,5720,3000,6318,5459,3442,4919,2543,6698,3685,6725,5338,1534,7216,5018,3494,6537,3497,5488,5772,3523,4970,3686,6427,3615,5350,2751,5511,5014,2003,3307,6266,3484,5433,6592,5570,1977,4598,3415,3444,6497,5662,2983,5029,5454,3847,3026,3389,6705,5353,1787,5675,7182,6347,5894,2931,1998,5295,2810,5243,4839,6207,3294,6484,5778,2551,4856,3498,6538,7240,5732,2973,5461,4977,3525,7425,3309,6671,5897,2926,6726,4590,5340,3631,6700,2783,6325,6439,5434,1978,4798,7189,3905,5017,6429,3876,5544,3784,4597,4972,3906,6376,3733,6268,5515,1903,2005,4943,3880,6349,3851,5793,6326,5703,5088,3689,3676,6787,5475,3041,4543,2006,3505,7300,3792,6706,5407,1951,5303,3888,6430,5354,2933,6729,5245,2987,5677,4829,3042,3908,6443,5780,5736,3419,6498,3969,5462,3028,5436,4923,7203,3315,2974,5361,2812,6355,5030,5898,3734,6545,7426,6329,5683,2989,2019,4978,7194,3526,5033,6540,3390,6488,5059,5465,3747,4843,3690,6730,6789,5572,1789,5517,7681,4601,3970,6737,3853,1980,6679,5523,4951,5020,3448,6384,3500,5327,3015,4830,1911,4925,3737,7248,3808,6350,5794,2009,5678,3639,6239,5905,2934,6471,5552,2021,2879,6708,3912,6944,5477,5307,3697,6546,3310,5356,2995,5784,5061,3431,3529,6500,5744,2555,6451,5707,3471,6445,3859,6561,5900,2937,5034,7205,3663,4980,3032,3750,6357,4602,5825,3506,7193,3749,6712,2799,5246,2010,5362,7190,4845,6976,3421,5685,2990,5518,5041,5062,3317,6732,7304,5466,5576,1967,4851,3530,7428,3738,6330,5478,4955,5525,3692,6790,5423,3044,6548,5689,1915,5036,7432,6371,3435,7040,2022,5364,3199,4926,6738,3263,6562,5715,3019,1790,5007,3854,6446,3479,6793,5309,6915,5686,3508,6504,3698,6683,5796,2938,4967,3643,3537,2557,3753,6255,4735,5481,3318,7206,3779,6475,5826,2997,1535,5709,7682,4984,302

1,3422,6358,5335,5906,4575,3671,6453,3740,5767,5468,7264,5042,7235,3862,5539,3048,5526,4846,5584,3532,6332,5800,2940,6593,5921,2012,5065,7209,3321,6361,6552,4604,5482,3754,4957,6753,3645,6740,5710,2025,5529,3483,6695,3875,6794,1975,6373,5690,4853,6303,3861,6564,5908,2998,5066,3781,6454,3437,7312,3512,6685,2026,3700,7196,3761,6917,5717,2911,6754,5692,3446,5015,2807,6801,3495,6477,5339,5431,7237,3538,6263,3865,5828,5718,7210,4971,3322,3443,5721,3056,5771,4958,5541,3553,6744,3646,5912,6483,5922,1917,4854,7684,3485,6362,5731,2558,5044,5722,3675,6512,3438,6796,5530,1999,5351,7217,6374,6535,1918,5808,3027,5773,5073,6457,3540,6594,5368,3001,5019,3727,6686,3972,7242,6478,5489,5068,3877,7440,3687,6377,5310,2811,6699,5484,3756,6918,3022,6319,3782,6267,5774,2033,7328,3501,4857,6802,3866,5779,3324,4973,3445,6756,3677,6485,5455,5600,1979,3920,6921,3762,5435,6364,5341,5048,3785,3704,6458,5490,3002,4591,5733,3554,7688,3878,6568,5542,2028,5545,7456,6539,5571,2927,5734,3029,5663,4799,6817,3499,6727,5355,5532,3976,6499,7696,5463,3030,5492,5031,7360,3486,6431,5895,2975,6327,5074,5437,3295,6378,7712,6269,6701,2034,4979,7238,3735,4858,6804,3764,6760,5342,3907,4599,3691,6486,3544,6460,5546,1981,7212,5021,3527,6385,3868,5573,6922,5357,4974,3881,6707,3786,5679,3043,4831,2007,3793,7299,3909,6489,5953,1982,5924,3788,6596,5832,2813,6541,5954,5781,3004,3936,6547,5928,5899,7249,6351,3882,5737,2935,5724,5089,7218,3678,6818,5553,3033,6702,5840,3984,6929,7241,6576,5936,3045,4981,7183,3794,5035,6501,3768,63 31 ,5090,5956,3449,7488,3507,6380,6808,5467,2011,6017,7301,5076,6768,3889,6731,5363,5022,4860,3391,6924,3693,7220,5782,2036,5037,3884,7191,3556,6849,5574,5438,3502,6270,5795,3034,6386,5738,2023,7302,6709,3910,6542,6018,5901,3739,6490,3560,6600,5496,2991,5548,5063,3311,3450,6502,5785,6549,5856,3531,6447,3694,6713,5687,2939,4982,7552,3699,3046,3509,6388,4927,5960,3452,7244,7305,6739,5745,2814,2040,5358,7250,5043,6333,3890,6710,5479,5577,4603,3533,6820,7224,5519,5907,7195,4985,3568,7265,3741,6505,5711,5080,5798,3751,6850,5554,2559,6733,5797,1791,4847,7207,3796,6359,6930,5469,3913,5038,6791,3701,6492,5365,2013,3423,6563,3539,6550,5578,6608,5786,6824,3510,6945,5740,3036,5092,3809,3323,7427,3534,6506,5483,3514,7252,3513,6734,5247,3049,6553,5311,7306,5067,2999,3541,6714,5902,5527,7313,3319,6932,3755,5556,5746,7429,4986,7197,3914,5691,3050,5585,4605,5801,3810,6741,7211,5366,6716,5827,2027,5045,7266,3971,6363,6455,5069,5470,3742,6852,3855,6742,5719,2014,5788,7683,6745,3921,6795,2029,6565,5910,5096,6936,3892,6946,5580,2941,4988,3800,6755,4000,7256,6746,5369,3863,7308,3439,6554,5802,3023,6375,5693,3973,2942,6832,3702,6797,5531,5923,7198,3757,6392,3916,5909,7314,5046,3705,3783,6513,5829,5485,5560,3325,6334,3763,5748,6508,5809,4959,7239,3896,6798,5494,3057,4855,5543,3974,7430,3758,6803,5586,1983,5913,7433,6479,6624,5370,3003,5491,5104,6459,3812,6365,5601,5694,3922,6514,3447,7329,6757,5533,4606,7744,3516,6566,5723,3052,6569,5486,3542,6595,7213,6758,3555,6687,2035,7268,3487,5075,6379,3557,6556,5588,3977,5049,3867,6487,3545,6516,5775,6020,7808,3706,6919,38 16,5925,6461,5735,4859,3924, 4032,5804,3058,5070,5830,3 937,7219,3765,6366,5549,2037,5914,7316,6570,5372,3005,5493,5725,6597,3869,6381,5968,5810,7214,6703,7243,5833,3031,5752,5050,7434,3978,6977,5602,3006,6948,5926,3787,6856,7441,6978,6805,4975,7685,3879,5077,6952,3546,6923,5547,3708,7272,3766,6761,3326,6748,6024,1919,7330,5078,6577,3789,6864,5534,5023,3647,6960,3985,7221,5343,2030,3870,7361,3883,6980,5783,5812,3451,6491,5955,3035,7041,5739,5592,7320,3769,6387,5575,5916,7245,6806,3503,5929,3060,5834,5091,7332,3679,6598,5841,6462,5957,3561,6819,7936,6762,5836,3047,4861,7436,3938,7042,3795,6925,5052,5984,3558,7442,7686,6520,6572,2038,5930,7222,4983,6809,3980,6880,5726,5081,3790,6711,3885,7251,6032,7225,5093,3548,7689,3928,6984,5842,5816,3911,6769,5497,3064,6382,5555,2041,7280,3797,6503,6601,5937,3770,6543,3986,6931,5439,5741,3824,3940,6735,5932,6822,5604,6578,3891,6821,5550,2815,5082,7303,3886,7246,3511,6493,5958,4001,7457,7362,6389,5787,3037,5608,7253,5039,6602,3562,6810,5359,5498,7444,3695,6764,7690,5579,5742,7226,4987,7336,3743,6507,5747,5094,5557,3811,6271,7307,5500,6335,2042,4862,7267,3988,6926,6551,5938,3535,6580,3915,6770,5581,2015,7254,6715,3453,6609,5616,6825,5789,6390,3569,6851,5799,3051,4607,4002,3893,7228,6494,5844,3798,7448,4033,6743,5961,3038,6812,5749,7257,3053,3944,6934,5471,5587,7458,7697,6604,3564,5558,7692,5084,7364,3703,6393,5857,5371,5582,3801,6826,7309,5562,6717,5561,5097,7269,3772,6555,6947,5047,5589,3515,7315,3813,6933,5367,2044,5803,7344,6853,6509,6584,5962,5098,6772,3917,6833,5858,3992,6518,3454,7310,6567,6019,7698,3894,6610,5790,3007,6937,5903,3923,7489,6394,3802,6515,5969,7199,3570,6625,3952,6718,5940,7368,4989,3814,3517,6557,5848,6048,7258,3543,6747,3707,5911,6510,5487,5071,7713,4004,6021,3059,4990,5750,3759,7460,7490,6612,5805,2031,5964,7700,6799,7044,5753,5831,6949,3975,6759,5373,5811,7431,6828,3897,7317,6854,5944,5105,7270,3572,6573,6022,3061,6938,5806,3918,6396,7273,6517,6749,7472,3817,5051,6992,3898,6834,5860,3804,3518,6857,4034,6776,5970,5495,7464,6626,4008,6950,5564,5100,3547,3925,7331,5590,5603,3939,7260,3709,6571,5535,5605,7215,7048,6025,2943,5915,5593,7435,3979,6558,5754,5864,7553,6367,7714,5972,3054,6080,5106,7492,3559,6807,5985,6836,5813,3767,6979,7376,6763,6616,5053,7554,3818,6599,3900,6940,5917,3825,7318,7321,6953,3926,6858,2039,7333,5079,6865,3929,6981,6026,5054,3576,6860,3871,7274,5835,7223,3327,7496,4036,7008,5927,5594,3981,5756,3062,6954,5814,5374,7704,3791,6750,5837,7745,7056,3549,5695,6033,7716,3987,6866,5918,6840,5931,6521,7281,6579,5499,3065,5083,7322,3710,7247,3820,6961,5817,4016,7437,7276,6463,6765,5551,7746,5108,6956,3941,6628,5727,7392,3563,6574,3771,7334,5609,7687,5095,7720,3826,6982,5986,5843,3930,6811,7363,5606,6632,2043,7438,3550,6383,6522,6028,4040,6603,3455,6766,5838,5933,7809,3982,6771,5596,6581,5976,6524,3887,5959,3066,5112,7691,4048,7443,6962,5845,3942,7748,7459,6605,5818,3039,6034,7227,6640,3989,6813,5872,5988,7337,7728,6823,7282,5939,7445,4863,7324,3799,6868,5934,5559,3565,6985,7255,6049,6773,5085,7365,3945,6495,6611,5610,3773,7284,4003,6582,5743,2045,7338,6881,6395,6606,5791,6586,3828,6585,5859,3932,3571,7229,6613,6036,7699,3803,6391,5583,3068,6827,5963,7693,7810,3895,6986,5501,7449,7446,6882,3994,5617,7694,5099,7345,3946,7043,6050,5941,7461,3990,6814,7556,5846,6927,6081,5086,7259,3574,6993,5101,5992,4005,7752,7937,6964,2046,5612,7366,6872,7072,5751,6935,3815,6511,5849,7340,7045,3832,7288,6774,5820,7369,3953,6829,5563,3055,6988,5861,3566,7504,6777,6855,7230,3774,6397,3993,6835,5965,7450,3573,3948,6968,6040,5502,7311,7046,3919,6830,5942,5055,7271,4064,7346,5971,5850,3519,7462,7261,6884,5618,6000,7812,6994,6519,5862,5565,7370,3805,6588,5591,5755,7760,6614,7491,6627,6052,5107,7560,3899,6559,5807,6629,4006,7049,7465,6939,6617,7938,3954,6778,4009,6888,6023,4035,7275,6996,3819,7104,5945,7348,7009,3577,6837,5620,5109,3927,3996,7319,5966,7377,3806,7452,3901,6941,5865,5946,7816,5852,3063,5566,6082,7262,7372,7050,6056,7466,6859,7568,5595,5973,7776,4037,6951,5987,6618,5757,6780,7520,6838,6398,4991,7493,4010,7701,3956,6861,6027,3578,7323,7378,6719,7057,7473,5102,6942,3821,6955,5607,4017,6523,4038,7715,5815,7468,7277,3827,6841,5866,5948,3931,7352,5873,6575,5974,7702,4012,6751,5977,7705,6633,3902,5624,5919,7283,3983,7010,5375,6867,6084,6630,7335,6029,3067,5110,7393,3943,7494,7052,5839,3711,7474,7940,6862,6957,5597,7325,6620,3960,7000,6035,7824,7497,6983,3551,7278,7285,5113,7380,4018,6869,5758,5868,3822,6842,7339,6064,7058,7944,4041,6896,7012,5989,3580,3933,6963,5611,5819,7498,6958,6583,5874,7073,3829,5978,7394,4042,7717,6634,5598,7706,7555,6767,6088,3069,5503,7476,7384,3991,6815,6030,7584,7439,6883,7447,5935,7326,5114,7505,3947,7060,6096,7718,3934,6607,7840,5990,6987,5087,7286,3830,6525,6037,4020,7500,7747,6641,2047,7708,7074,6965,5847,6870,4049,7105,5613,7557,3995,7341,7016,5993,7289,4044,5821,3070,6636,6051,7721,7367,6775,7952,7347,6873,3833,5876,7396,7506,3949,6844,5980,5619,7480,6587,7872,6885,5851,5116,7558,4024,7342,5943,3567,7722,77 49,6989,6042,7561,7064,6526,5994,7451,3775,6966,6038,7290,6995,7616,6874,5622,7521,4007,6642,6053,7024,4050,7729,6886,6589,7371,3955,6615,3834,6779,5863,7231,7508,3575,7076,5880,7562,6831,3997,6001,5103,7695,3950,7750,5614,7724,3807,7349,7463,7047,5822,6041,7453,6969,5621,5996,7400,7292,6644,5967,7373,6990,7350,6112,7811,4065,6889,5567,6970,6876,7730,6590,7106,7454,3957,7753,4011,7080,5853,4066,7467,6619,6997,7522,7011,4052,6781,5947,3998,3836,7379,6054,7569,7353,4013,7051,6002,6057,7564,7512,6083,5867,7754,7813,6631,5625,7761,6839,7703,5975,6044,7408,4039,6890,5854,6972,5949,6897,7374,6998,5111,7263,3958,7495,7001,3903,7732,7968,6648,6943,7570,6399,4019,7108,6085,7524,7053,3579,7475,7469,7585,3961,6863,6058,6004,4056,7381,5626,6621,7736,3823,7059,5869,8000,4014,6065,6086,7756,6782,6892,5875,7088,7354,5979,7814,4068,7572,7013,6060,7395,8064,6635,6843,5950,7762,7586,4043,6898,6031,7470,7817,7002,7939,7528,5115,7707,3962,6622,5991,3581,7112,7279,5759,6527,7499,4021,7054,6008,4045,7382,6959,5599,7477,7120,6066,7014,4072,5870,7356,3964,7617,7061,6089,7385,7576,5628,3071,5981,7777,7764,6871,7719,7818,6637,7397,5877,7327,7588,4022,7017,6090,7478,6845,7709,7075,5117,7941,3935,7778,6039,3831,7825,7501,6900,7287,7004,6643,5995,4080,6875,5982,7768,7507,6967,5878,7386,3582,6068,7066,7536,7820,7018,7398,7559,7062,4051,6097,7481,7618,4025,6646,6043,7710,7077,7502,6092,5118,7401,3835,7723,7942,4046,7343,7291,6887,5881,7826,6904,5997,7780,7509,7025,7945,6638,7388,6072,7482,4026,6846,5615,7065,7592,6645,7020,7563,3951,4053,6991,5823,7841,7751,7136,7523,6591,4054,6055,7455,3999,7351,6098,7402,7293,7725,6877,6003,5882,7828,7784,5623,7510,7484,6971,6045,7409,7078,7946,5998,7731,4067,7026,5855,7081,7107,7513,6891,7620,3837,7565,6649,4028,7571,6999,7068,7375,6878,3959,6973,6113,7842,4057,7726,7953,7600,4069,6005,6059,7525,7355,6114,7404,7832,7109,6100,7792,7755,6046,5884,7948,7082,7028,6061,6650,7873,7294,4058,7410,6893,7733,7566,7089,7110,7514,7624,4015,6899,6087,7526,7003,7573,7471,7737,3963,7084,6006,4070,7412,5951,6974,7763,3838,7055,6067,7357,7734,5627,7844,7015,6009,6783,7529,6104,7874,3583,7757,7032,5871,7383,7954,6623,6062,7815,7516,7090,7587,7574,6894,7632,7848,7969,4060,7113,6116,6652,7530,7005,7758,4073,7577,6091,4023,7738,6901,7956,7114,6010,4074,5629,7765,7740,7063,6069,7387,7479,6093,7876,7766,7019,7769,7819,7006,7589,6120,7960,7970,3965,6902,6012,7779,7092,7770,5119,7578,4047,7399,3966,7856,7821,7121,7416,7067,6070,7537,7116,7358,7532,5983,7822,4081,5879,6905,7827,7021,7503,7648,4027,6128,7483,7389,7096,7538,6639,7781,5630,7590,4076,7593,7619,7782,7711,6847,6099,7403,7580,6073,7511,7540,7079,7943,7122,7485,5883,4082,7027,6094,6906,7390,6647,7594,4029,7069,7621,7405,7022,7727,6879,4055,6074,8001,4030,7972,7880,8002,7829,5999,6101,7976,7947,7785,7772,7137,6102,7601,7888,6047,7984,7029,7083,7138,8004,7515,4059,8065,7124,7411,7070,6908,7830,4084,7085,6115,7622,7486,7843,7786,4071,5885,8066,7949,6076,7544,7596,7111,6007,7833,7904,6105,7735,7030,6117,6975,8008,7793,4088,7406,7091,7527,7625,6651,7567,7955,7033,7759,7128,7846,7602,7845,3839,6895,6106,7517,7086,7413,4061,6063,7626,7834,7788,7140,6011,7531,6118,7295,7359,7115,5886,7950,7575,7604,7794,7034,7739,7633,6653,7849,7414,7875,4075,7093,5631,7117,7518,7767,4062,7836,4077,7958,7144,7628,7036,6108,7417,7850,7741,6121,7579,7971,6071,7957,7094,7877,7533,7608,6122,7796,7857,7007,7542,6903,7591,7634,4031,7961,7418,7539,7152,7649,7742,6013,7581,6654,7771,7534,6095,4083,6014,7123,7636,7097,7823,8068,7973,7783,6907,7852,7118,7878,6129,7597,4085,7962,7420,7541,7773,6075,8016,7858,7881,7800,7098,7650,7974,6124,7023,7125,7595,8072,3967,7126,7582,7071,7391,4078,6130,7831,7860,8003,7787,7640,6077,7623,7964,7977,7882,7139,6103,7889,8005,6078,7884,6909,7100,8032,4086,7978,7031,7774,7129,8080,7141,7890,7864,7545,7603,4089,6107,7985,7487,7789,6132,7980,7652,7598,7130,6119,8006,7835,7656,7087,7407,7546,7627,7790,7035,7795,7142,7605,7548,4090,6910,6136,7986,7629,4063,7664,7837,7847,6655,5887,7892,8009,7797,6109,7519,7635,7606,7132,7905,7419,7

630,7610,7609,7145,7095,7637,7415,4092,7851,8010,7146,7906,6123,8067,7838,7951,6110,8017,6125,7988,7037,7896,8096,7959,7535,7119,8069,7038,7798,7853,4079,8012,7801,7879,7421,7859,7992,7153,8070,7854,6079,7099,7908,8018,7543,7612,7148,7638,7651,6131,7583,7653,8073,7963,7641,7802,7912,8020,8128,7154,8033,7861,6133,7101,7965,4087,7127,8074,7102,7883,7975,7642,7804,7862,7422,6015,7885,7743,8081,6126,7966,7979,7547,7131,7865,7599,7156,7775,7657,7143,8034,7891,7654,4091,6134,8076,7886,7981,7644,8024,8007,7160,6137,7893,7866,8082,7920,8036,7987,6911,7982,7607,8097,7133,7658,7791,4093,7839,7907,6138,8084,7631,8011,6111,7549,7665,7147,8098,7989,7894,8129,7134,7149,8040,4094,7660,7799,7897,7868,7611,7909,6140,8013,8088,7550,7990,7103,8019,7898,7666,8048,7910,7613,7639,7803,8100,7155,7855,6127,8071,7993,7668,7157,8014,7913,7994,7900,7614,8130,8104,7643,8021,8035,7805,7039,8075,7150,7655,7863,7914,7996,7921,8022,6135,8025,7672,7967,7423,8132,8077,7158,7887,7645,8083,7161,7806,7916,8112,8037,7659,7867,7922,8026,6139,7646,8136,7551,8078,7983,7162,8144,8038,7135,8085,4095,7895,7661,8041,7869,8099,6141,7924,8028,7667,7899,7164,7991,8090,8042,8086,7670,8101,6142,7911,7928,8049,7151,7662,7870,8089,7669,8044,8015,8160,7615,7901,7995,8102,8050,8105,8131,7915,7673,8023,8092,7902,7997,7159,8133,8106,8052,7674,7917,8113,8134,7923,8027,8108,7998,8079,7163,8039,7807,8056,7647,8114,7918,8137,7676,8029,7925,8138,7165,8087,8043,8030,7926,8116,6143,8145,8091,8140,7166,7929,8045,8120,7663,7871,8103,8146,8051,7930,7671,8093,8046,7903,8161,8053,8107,8162,8148,8094,7932,8109,8135,8054,7999,8115,7675,8057,8152,7919,8110,8164,8139,8058,7677,8117,8141,8168,8060,7167,8118,8031,7927,8176,7678,8147,8121,7931,8142,8122,8047,8149,8150,8095,8163,7933,8124,8055,8153,8165,8154,8111,8059,8166,7934,7679,8156,8169,8119,8170,8061,8143,8062,8177,8123,8172,8178,8125,8151,8126,8155,8180,8167,8184,7935,8157,8171,8158,8173,8127,8179,8181,8063,8174,8182,8185,8186,8159,8188,8175,8183,8187,8189,8190, 8191]

**Sequence group 4: Z4_8192**

[0,1,2,7,3,8,11,24,4,10,13,28,16,33,35,77,5,12,14,32,19,38,47,81,22,46,42,88,57,96,102,168,6,17,21,40,23,45,51,90,29,55,59,97,72,111,117,188,34,61,75,115,80,124,134,200,87,136,147,227,152,239,260,388,9,18,26,54,30,58,71,105,36,76,62,118,84,128,141,209,44,74,86,135,92,144,151,233,100,154,170,251,186,269,289,434,53,89,98,150,112,161,179,266,122,180,199,281,211,306,324,474,138,207,230,312,236,325,351,508,257,360,381,535,402,563,610,869,15,25,31,73,39,79,82,140,48,85,93,149,101,159,165,263,56,94,103,162,116,178,196,284,127,197,208,299,232,320,345,495,64,109,123,185,129,198,215,314,148,228,237,327,256,358,373,534,163,247,267,364,282,397,405,560,308,421,456,596,484,633,710,871,69,125,143,218,158,235,254,362,169,258,272,387,290,404,433,585,194,285,300,418,326,447,479,646,341,487,516,679,543,723,752,1013,214,315,335,462,365,494,521,698,401,530,561,739,598,759,831,1101,430,572,611,796,628,854,886,1172,704,908,941,1157,980,1229,1326,1690,20,37,41,91,49,95,106,177,50,107,119,189,131,210,219,343,63,120,132,224,145,231,245,344,153,244,261,379,286,400,410,559,67,142 ,155,226,173,248,268,398,183,278,291,413,305,444,467,623,181,301,318,443,340,480,499,680,368,523,544,721,569,747,805,1077,78,167,174,275,192,297,316,435,201,323,332,476,352,506,528,718,259,346,367,514,390,540,568,742,424,578,617,791,649,851,892,1147,296,383,414,554,442,595,621,834,470,640,661,867,711,922,953,1210,518,708,725,942,743,982,930,1253,816,1066,1102,1346,1114,1470,1534,1770,83,190,195,339,249,357,372,522,276,377,391,549,423,580,615,837,292,419,439,583,459,622,653,875,488,664,697,914,740,949,1010,1269,342,445,465,652,497,688,731,932,547,732,754,1002,817,977,1086,1358,593,781,844,1069,877,1112,1152,1427,924,1163,1161,1518 ,1258,1560,1614,1954,382,485,525,734,579,757,804,1029,618,835,857,1105,903,1124,1159,1463,654,883,936,1148,960,1168,1262,1564,1025,1276,1321,1626,1393,1709,1763,2143,719,944,994,1265,1083,1271,1375,1655,1098,1366,1437,1743,1498,1815,1922,2303,1129,1475,1553,1847,1597,1936,1888,2356,1684,2008,2061,2509,2169,2594,2711,3024,27,43,52,99,60,121,133,216,66,137,146,22

3,157,242,246,394,68,156,166,241,175,298,309,429,203,311,
338,471,354,501,526,737,70,172,191,304,205,336,348,492,217,361,374,531,396,564,590,761,229,385,409,575,437,
614,635,822,449,624,667,882,677,912,945,1335,110,204,212,353,225,375,395,553,252,411,425,603,453,643,663,8
42,274,428,464,631,490,675,683,894,513,686,695,952,778,983,1055,1362,293,489,504,693,539,727,736,968,567,7
77,808,1024,861,1078,1106,1442,601,830,878,1111,925,1144,1216,1504,991,1226,1280,1565,1322,1633,1724,212
6,113,221,243,406,271,426,458,648,288,468,493,687,519,702,713,962,322,505,537,716,566,771,799,1019,599,819,
859,1096,895,1131,1191,1449,349,551,589,806,636,846,843,1134,655,884,910,1173,971,1221,1241,1575,701,927,
986,1230,1021,1292,1325,1659,1065,1353,1409,1744,1515,1828,1930,2320,370,608,642,888,682,921,973,1227,76
8,990,1035,1312,1042,1331,1387,1704,783,1038,1064,1373,1140,1406,1484,1812,1204,1507,1548,1854,1612,1969 ,2019,2375,821,1156,1182,1452,1249,1521,1559,1904,1281,1608,1666,2001,1726,2071,2155,2532,1414,1670,1751 ,2085,1841,2182,2232,2680,1910,2280,2350,2749,2439,2873,2997,3468,130,253,279,469,319,503,533,746,329,542 ,573,774,604,813,874,1193,363,591,647,838,669,918,900,1208,689,937,978,1275,1030,1299,1340,1685,438,657,69
1,915,767,966,996,1319,773,1034,1051,1342,1081,1388,1425,1781,785,1074,1121,1420,1201,1480,1540,1862,123
6,1591,1610,1980,1668,2021,2105,2491,451,766,770,1022,789,1040,1093,1399,827,1142,1179,1465,1222,1529,16
01,1943,985,1197,1252,1545,1286,1627,1674,2013,1395, 1680, 1755,2090, 1846,2171,2223,2675,1047,1290,1372,16
31,1415,1738,1790,2122,1492,1824,1875,2218,1937,2285,2370,2800,1555,1917,1993,2348,2059,2416,2486,2890,2
136,2518,2589,2981,2630,3134,3154,3775,463,792,812,1188,963,1214,1239,1586,1005,1273,1309,1644,1384,1697 ,1775,2110,1058,1336,1411,1713,1459,1798,1880,2203,1533,1932,1869,2257,2014,2363,2438,2822,1205,1429,147
9,1831,1572,1891,1985,2333,1621,1995,2056,2419,2098,2447,2539,2965,1728,2076,2151,2502,2236,2604,2660,30
78,2299,2734,2785,3204,2879,3279,3302,3640,1287,1486,1615,1998,1692,2044,2077,2474,1768,2164,2188,2574,2
265,2609,2754,3149,1786,2251,2339,2728,2432,2802,2815,3295,2523,2897,2946,3355,3056,3484,3563,3985,1950,
2402,2422,2859,2557,2906,2987,3389,2624,3072,3095,3547,3225,3569,3792,4143,2697,3187,3264,3681,3373,372
0,3854,4279,3433,3888,3969,4392,4064,4487,4566,4981,65,104,114,184,126,187,220,313,139,206,234,337,264,37
1,386,594,160,222,240,369,283,399,450,607,307,448,422,638,502,672,703,943,171,265,295,416,310,446,475,645,3
50,486,509,676,571,735,760,1004,376,520,587,751,605,786,818,1045,637,825,863,1127,891,1167,1228,1567,202,2
70,330,482,355,507,565,712,392,592,527,762,629,797,850,1073,432,584,632,823,662,856,881,1143,694,897,951,1
195,1001,1248,1306,1676,481,639,678,873,738,913,975,1243,776,981,1043,1285,1076,1351,1400,1769,833,1068,1
135,1370,1151,1402,1468,1845,1215,1495,1543,1903,1595,1966,2067,2568,250,328,359,577,408,600,613,848,454,
630,665,870,696,911,931,1238,500,668,705,917,753,972,1032,1295,794,1033,1071,1333,1138,1391,1455,1819,536 ,726,780,999,802,1037,1087,1377,865,1132,1155,1410,1213,1491,1525,1902,920,1186,1245,1506,1289,1584,1602,
1962,1357,1642,1730,2038,1795,2113,2268,2571,557,788,853,1097,906,1146,1203,1502,946,1219,1256,1562,1307 ,1599,1672,2017,1023,1297,1334,1638,1404,1708,1780,2139,1447,1801,1865,2206,1923,2297,2354,2826,1085,138
0,1434,1740,1510,1816,1877,2244,1594,1896,1964,2324,2041,2368,2500,2969,1664,1983,2069,2437,2104,2542,25
99,3084,2255,2636,2695,3061,2766,3176,3325,3844,287,393,420,660,455,670,715,970,461,717,764,1008,810,1075 ,1100,1451,529,769,814,1120,860,1136,1181,1453,893,1180,1232,1538,1298,1589,1618,1960,548,852,901,1123,95
8,1190,1247,1585,993,1274,1310,1625,1349,1700,1753,2094,984,1339,1385,1698,1445,1784,1827,2208,1517,1883 ,1928,2294,1978,2340,2453,2930,597,940,959,1263,1017,1328,1382,1678,1046,1398,1423,1773,1473,1840,1893,2
288,1225,1457,1513,1860,1570,1915,1977,2330,1649,1999,2081,2428,2148,2538,2610,3044,1324,1551,1630,1953,
1696,2036,2089,2506,1759,2128,2170,2564,2271,2665,2718,3147,1871,2263,2302,2696,2331,2768,2679,3215,247
1,2915,2970,3353,2992,3536,3630,3950,626,1011,1027,1441,1192,1489,1523,1879,1267,1532,1574,1940,1647,200
6,2075,2513,1313,1640,1688,2012,1736,2091,2154,2579,1803,2176,2242,2649,2326,2709,2820,3238,1450,1702,17
49,2153,1822,2224,2310,2682,1935,2312,2359,2806,2473,2761,2944,3371,2031,2406,2527,2918,2584,298

8,3053,3
475,2667,3070,3067,3605,3223,3664,3741,4187,1546
,1797,1886,2315,2004,2365,2451,2849,2083,2507,25
47,2976,
2628,3007,3063,3524,2156,2593,2687,3046,2732,307
9,3229,3670,2843,3248,3317,3757,3423,3870,3940,4
422,229
0,2701,2789,3233,2939,3240,3400,3797,2962,3384,3
490,3915,3578,4011,4148,4608,3014,3544,3654,4053
,3718,41
66,4102,4669,3836,4255,4323,4841,4451,4930,5056,
5374,333,427,477,685,515,772,815,1089,546,826,862
,1118,90
4,1175,1184,1579,555,902,934,1170,961,1330,1360,1
660,1053,1364,1439,1761,1478,1830,1890,2319,562,
955,101
4,1347,1062,1436,1462,1813,1091,1500,1527,1898,1
583,1968,2027,2373,1133,1558,1613,1991,1682,2074
,2116,24
84,1711,2096,2181,2592,2201,2644,2703,3337,729,1
056,1080,1474,1122,1528,1581,1948,1199,1620,1652
,2050,17
22,2134,2174,2522,1260,1657,1747,2108,1809,2198,
2215,2614,1857,2220,2238,2715,2400,2770,2895,337
8,1317,1
807,1836,2235,1914,2305,2317,2747,1974,2399,2458
,2841,2555,2932,2978,3495,2047,2498,2586,2986,26
70,3038,
3156,3585,2783,3170,3254,3672,3320,3766,3893,440
3,745,1109,1177,1606,1251,1653,1734,2146,1302,17
54,1814,
2222,1873,2250,2276,2737,1397,1839,1908,2283,197
2,2389,2443,2834,2042,2477,2550,2959,2616,3017,3
113,350
5,1464,1945,2025,2456,2120,2530,2524,3022,2159,2
595,2641,3086,2752,3162,3194,3685,2249,2673,2777
,3178,28
36,3271,3323,3803,2912,3362,3446,3917,3599,4026,
4157,4625,1520,2063,2132,2602,2213,2663,2756,317
1,2385,2
782,2858,3306,2871,3332,3415,3861,2409,2863,2910
,3396,3030,3440,3558,4006,3137,3590,3648,4062,37
39,4204,
4268,4689,2480,3060,3099,3510,3208,3608,3663,412
4,3256,3733,3813,4247,3895,4334,4435,4863,3456,3
819,392
6,4350,4045,4469,4524,5022,4133,4581,4661,5094,4
762,5224,5345,5787,807,1200,1278,1756,1386,1834,
1901,233
7,1413,1920,1986,2395,2054,2467,2577,3116,1505,2
029,2141,2515,2186,2657,2623,3144,2227,2689,2763
,3246,28
51,3285,3344,3838,1683,2162,2230,2651,2383,2744,
2792,3315,2393,2856,2888,3347,2936,3417,3473,396
7,2414,2
926,3003,3465,3131,3552,3638,4071,3185,3710,3735
,4220,3815,4271,4374,4822,1716,2381,2387,2839,24
23,2866,
2954,3431,2493,3035,3094,3527,3164,3622,3724,417
5,2775,3124,3213,3645,3262,3758,3824,4261,3426,3
831,393
1,4356,4052,4453,4514,5017,2880,3268,3394,3763,3
457,3910,3980,4397,3570,4020,4086,4508,4167,4588
,4683,51
49,3656,4141,4236,4659,4319,4737,4816,5242,4414,
4849,4925,5330,4971,5478,5497,6054,1742,2430,246
5,3107,2
739,3153,3191,3702,2811,3244,3300,3781,3411,3853
,3958,4381,2901,3339,3449,3877,3518,3991,4092,44
93,3628,
4159,4079,4556,4262,4677,4761,5171,3139,3479,355
1,4029,3680,4107,4226,4642,3751,4238,4317,4739,4
364,477
1,4872,5315,3899,4339,4430,4833,4529,4940,5002,5
424,4603,5080,5133,5545,5231,5616,5638,5938,3263
,3561,37
43,4243,3847,4301,4341,4800,3947,4444,4476,4910,
4565,4946,5100,5492,3974,4548,4649,5073,4755,515
0,5165,5
632,4855,5249,5299,5687,5404,5800,5869,6221,4182
,4721,4744,5208,4894,5257,5336,5716,4964,5418,54
40,5856,
5565,5875,6067,6348,5039,5530,5600,5972,5702,600
7,6118,6452,5757,6146,6209,6535,6285,6604,6660,6
941,108,
164,176,273,193,277,317,440,213,302,334,472,378,5
12,532,787,238,321,347,510,403,545,612,801,431,60
9,576,83
9,674,880,916,1198,255,380,415,570,436,606,641,84
7,483,658,684,885,756,954,987,1272,517,699,779,97
4,798,10
12,1052,1315,836,1060,1107,1412,1137,1456,1526,1
905,294,384,460,651,491,681,750,929,538,784,706,9
89,828,1
031,1090,1350,586,775,832,1057,868,1099,1126,142
8,905,1145,1207,1488,1266,1550,1616,2028,650,840,
889,111
7,957,1165,1237,1542,1003,1242,1311,1588,1355,16
63,1718,2125,1070,1345,1419,1687,1438,1720,1794,
2212,151
2,1826,1882,2275,1939,2344,2455,2990,356,457,498,
763,556,793,809,1088,616,829,872,1113,909,1160,11
85,1536 ,671,876,919,1169,979,1234,1300,1600,1026
,1301,1348,1645,1422,1710,1782,2183,714,947,1007,
1261,1036,1305,
1365,1695,1108,1416,1444,1727,1509,1821,1858,227
4,1174,1477,1544,1838,1593,1926,1947,2338,1669,1
990,208
8,2421,2158,2503,2669,2994,744,1016,1095,1374,11
54,1433,1499,1833,1202,1516,1561,1900,1617,1944,
2024,239
8,1293,1604,1646,1984,1721,2060,2138,2534,1772,2
166,2234,2606,2296,2700,2760,3259,1363,1699,1758
,2100,18
42,2180,2246,2642,1938,2267,2342,2729,2426,2774,
2917,3407,2016,2364,2457,2848,2490,2958,3019,352

3,2655,3059,3120,3501,3196,3619,3773,4297,407,541,574,864,619,879,933,1231,625,938,992,1277,1044,1354,1379,1777,709,997,1048,1403,1103,1421,1472,1779,1141,1471,1530,1876,1605,1933,1963,2336,733,1094,1149,1408,1217,1482,1549,1927,1255,1578,1622,1971,1662,2052,2111,2482,1246,1651,1705,2049,1771,2145,2190,2608,1849,2252,2301,2698,2358,2746,2865,3366,790,1194,1218,1569,1288,1639,1701,2030,1316,1715,1746,2131,1799,2205,2262,2691,1522,1783,1844,2229,1907,2287,2357,2735,1997,2380,2469,2838,2541,2952,3029,3486,1636,1889,1976,2328,2046,2420,2476,2922,2118,2521,2562,2985,2672,3090,3146,3589,2240,2662,2705,3122,2736,3198,3103,3661,2884,3349,3409,3801,3428,3989,4083,4405,824,1282,1296,1767,1483,1818,1856,2248,1573,1870,1912,2314,1996,2386,2464,2928,1624,1988,2040,2392,2095,2479,2546,3001,2168,2569,2640,3075,2730,3136,3253,3684,1776,2053,2107,2545,2185,2622,2714,3106,2309,2716,2765,3237,2886,3190,3382,3821,2413,2816,2941,3352,3005,3425,3494,3925,3093,3509,3507,4057,3669,4116,4194,4638,1885,2161,2254,2720,2384,2772,2862,3282,2470,2924,2966,3413,3051,3445,3504,3978,2549,3013,3112,3488,3161,3517,3675,4121,3277,3694,3765,4208,3873,4325,4395,4870,2693,3128,3219,3679,3376,3687,3849,4253,3402,3834,3939,4369,4028,4465,4599,5051,3453,3996,4106,4505,4173,4615,4555,5109,4289,4704,4773,5275,4898,5363,5484,5784,466,581,644,896,692,1000,1049,1368,728,1061,1104,1401,1153,1466,1476,1919,741,1150,1189,1461,1223,1641,1675,2011,1327,1681,1765,2119,1806,2193,2259,2724,748 ,1212,1284,1658,1338,1760,1788,2177,1369,1832,1863,2269,1925,2346,2408,2780,1417,1895,1959,2372,2034,2462,2505,2899,2066,2483,2576,3011,2601,3069,3129,3785,950,1332,1359,1800,1407,1864,1921,2323,1493,1965,2002,2436,2079,2529,2567,2935,1566,2009,2106,2497,2173,2597,2613,3034,2226,2618,2635,3143,2810,3200,3330,3829,1629,2172,2199,2632,2286,2708,2722,3175,2352,2809,2870,3275,2974,3368,3414,3946,2433,2914,3006,3422,3096,3481,3598,4036,3212,3612,3699,4122,3768,4218,4346,4851,965,1390,1467,1952,1556,2003,2093,2540,1611,2112,2178,2620,2241,2648,2678,3166,1714,2204,2281,2686,2351,2798,2854,3267,2427,2891,2968,3398,3036,3455,3556,3957,1789,2321,2405,2868,2511,2943,2938,3462,2552,3016,3065,3525,3181,3604,3637,4137,2647,3098,3206,3620,3270,3716,3771,4258,3346,3812,3897,4371,4051,4480,4607,5070,1852,2450,2526,3021,2612,3088,3184,3614,2794,3211,3291,3754,3304,3780,3865,4315,2819,3296,3343,3846,3471,3891,4008,4460,3580,4042,4101,4513,4192,4658,4717,5129,2893,3499,3541,3963,3653,4061,4114,4578,3700,4186,4267,4698,4349,4783,4883,5297,3906,4273,4380,4799,4498,4915,4970,5451,4585,5024,5102,5520,5198,5643,5756,6168,1041,1494,1582,2115,1706,2197,2273,2743,1733,2293,2367,2804,2441,2878,2999,3560,1837,2411,2536,2929,2583,3083,3043,3587,2625,3114,3193,3692,3283,3732,3793,4291,2035,2554,2627,3077,2791,3173,3222,3762,2803,3289,3322,3795,3374,3867,3922,4419,2824,3361,3439,3914,3575,4003,4091,4523,3627,4164,4189,4675,4270,4719,4824,5258,2072,2788,2796,3273,2833,3298,3393,3882,2909,3477,3534,3982,3607,4076,4178,4624,3205,3568,3659,4097,3706,4210,4278,4709,3875,4284,4386,4805,4503,4901,4960,5446,3314,3714,3843,4216,3908,4363,4432,4846,4019,4474,4539,4955,4617,5031,5123,5570,4109,4594,4688,5099,4770,5176,5254,5656,4862,5283,5359,5742,5401,5883,5900,6413,2102,2840,2877,3550,3168,3595,3634,4156,3243,3690,3749,4235,3860,4306,4412,4831,3335,3787,3901,4332,3972,4443,4545,4939,4081,4610,4531,4999,4711,5115,5196,5591,3582,3928,4001,4484,4131,4560,4679,5086,4203,4691,4767,5179,4814,5207,5306,5728,4352,4788,4878,5268,4975,5373,5432,5830,5046,5506,5557,5944,5647,6012,6031,6307,3708,4010,4196,4694,4299,4753,4790,5240,4401,4892,4922,5344,5008,5378,5525,5896,4427,4992,5090,5499,5191,5572,5584,6024,5288,5663,5713,6077,5812,6181,6245,6568,4632,5163,5182,5630,5327,5671,5746,6104,5394,5825,5846,6233,5963,6249,6425,6680,5468,5930,5999,6340,6090,6371,6474,6773,6143,6497,6556,6847,6623,6908,6958,7203,724,928,969,1259,1020,1270,1383,1693,1084,1343,1432,1764,1537,1855,1899,2418,1164,1396,1460,1850,1598,1931,2070,2448,1667,2065,1994,2516,2196,2590,2653,3126,1211,1541,1634,1981,1679,2058,2130,2

533,179
3,2165,2216,2598,2362,2721,2778,3242,1868,2245,2
403,2758,2442,2825,2889,3309,2512,2904,2979,3451
,3027,35
15,3617,4126,1320,1554,1737,2152,1810,2210,2349,
2677,1913,2412,2260,2781,2495,2852,2950,3359,202
2,2396,2
501,2900,2566,2964,3010,3478,2633,3040,3141,3565
,3235,3651,3745,4280,2149,2519,2605,2998,2727,30
74,3188,
3642,2808,3197,3305,3705,3365,3809,3883,4402,292
1,3351,3463,3840,3492,3886,3986,4502,3596,4023,4
095,457
6,4170,4654,4779,5338,1487,1732,1825,2378,1957,2
431,2461,2948,2080,2496,2573,2991,2639,3066,3104
,3632,21
91,2581,2658,3081,2764,3182,3287,3723,2845,3288,
3357,3783,3469,3871,3968,4470,2279,2706,2814,322
8,2860,3
294,3383,3851,2982,3459,3498,3898,3593,4017,4068
,4575,3087,3548,3644,4040,3712,4153,4179,4648,38
18,4232,
4354,4743,4438,4835,5011,5341,2334,2831,2957,339
9,3057,3485,3579,4033,3133,3602,3666,4119,3746,4
176,427
5,4715,3274,3727,3784,4225,3889,4322,4417,4865,3
954,4447,4526,4942,4600,5043,5106,5595,3380,3856
,3935,43
66,4047,4466,4542,4984,4169,4568,4651,5074,4749,
5120,5266,5731,4264,4678,4781,5195,4821,5310,536
8,5836,4
996,5407,5465,5815,5537,5919,6051,6466,1609,1918
,1989,2560,2086,2587,2684,3179,2099,2690,2786,32
50,2875,
3364,3406,3961,2266,2795,2882,3437,2972,3466,353
9,3964,3033,3538,3624,4088,3730,4161,4199,4646,2
313,295
6,3048,3444,3158,3554,3650,4154,3217,3691,3752,4
207,3806,4310,4383,4810,3203,3791,3863,4307,3952
,4424,44
78,4944,4055,4550,4605,5041,4672,5091,5214,5697,
2425,3119,3159,3676,3265,3776,3858,4282,3312,388
0,3919,4
409,3993,4496,4562,5034,3611,3970,4049,4520,4128
,4591,4671,5082,4242,4695,4794,5187,4875,5304,53
79,5801,
3770,4104,4214,4636,4304,4741,4803,5271,4391,485
3,4899,5334,5014,5436,5489,5893,4534,5005,5049,5
466,508
3,5539,5449,5954,5236,5681,5732,6074,5751,6224,6
299,6543,2488,3257,3280,3945,3557,4014,4066,4544
,3682,40
80,4135,4620,4240,4702,4787,5278,3755,4229,4295,
4708,4361,4806,4881,5349,4449,4907,4982,5420,507
6,5481,5
588,5974,3960,4313,4377,4880,4472,4961,5059,5453
,4614,5061,5111,5576,5238,5532,5710,6088,4733,51
66,5293,
5683,5354,5747,5809,6173,5438,5822,5820,6280,596
0,6325,6387,6710,4098,4441,4552,5064,4700,5118,5
211,561
9,4796,5272,5317,5737,5398,5767,5817,6216,4884,5
362,5458,5803,5503,5831,5966,6330,5613,5984,6044
,6399,61
34,6484,6537,6868,5036,5472,5560,5970,5706,5977,
6113,6429,5725,6099,6186,6518,6257,6588,6683,698
5,5774,6
230,6317,6615,6368,6694,6652,7020,6460,6756,6802
,7124,6887,7176,7243,7409,1752,2007,2135,2617,22
33,2801,
2883,3387,2307,2907,2975,3435,3054,3529,3546,414
5,2329,3049,3110,3521,3165,3778,3826,4259,3327,3
833,394
3,4393,4000,4482,4558,5068,2343,3151,3260,3802,3
341,3937,3976,4462,3390,4031,4073,4570,4150,4656
,4727,51
27,3460,4113,4193,4685,4287,4786,4837,5251,4329,
4812,4913,5361,4936,5415,5474,6062,2712,3333,337
2,3994,3
443,4074,4147,4629,3572,4201,4249,4759,4343,4860
,4905,5286,3673,4257,4375,4828,4457,4933,4952,53
84,4517,
4957,4977,5487,5160,5541,5660,6094,3760,4455,449
0,4973,4590,5053,5066,5517,4665,5159,5220,5611,5
324,569
9,5739,6191,4757,5264,5356,5745,5441,5797,5902,6
262,5554,5913,5989,6332,6047,6406,6500,6854,2741
,3419,35
31,4184,3658,4250,4359,4873,3737,4384,4463,4959,
4536,4990,5019,5508,3879,4495,4582,5028,4663,514
6,5202,5
603,4750,5244,5319,5723,5386,5776,5864,6199,3979
,4627,4724,5218,4843,5295,5289,5781,4888,5364,54
12,5838,
5523,5907,5935,6343,4989,5443,5548,5921,5606,600
4,6049,6434,5677,6082,6152,6520,6275,6599,6688,6
995,405
9,4775,4857,5370,4950,5434,5527,5914,5141,5553,5
628,6034,5640,6058,6127,6479,5168,5633,5674,6109
,5790,61
48,6240,6584,5885,6267,6313,6620,6386,6722,6765,
7033,5246,5814,5850,6204,5948,6282,6324,6667,599
1,6380,6
441,6751,6502,6810,6877,7137,6158,6446,6526,6820
,6611,6897,6934,7227,6672,6967,7015,7265,7076,73
33,7396,
7603,2869,3573,3697,4387,3864,4488,4573,5089,390
5,4597,4680,5154,4764,5230,5347,5866,4039,4730,4
867,528
0,4919,5429,5392,5891,4965,5460,5535,5982,5621,6
016,6068,6462,4288,4890,4967,5422,5139,5515,5562
,6041,51
52,5626,5654,6070,5704,6129,6171,6554,5173,5692,
5762,6165,5880,6236,6304,6628,5927,6362,6383,673
3,6443,6
767,6835,7112,4336,5136,5144,5609,5183,5635,5719,6140,5260,5794,5844,6218,5909,6294,6374,6701,55
46,5873,
5952,6310,5996,6400,6450,6760,6136,6456,6530,682
4,6614,6888,6927,7224,5648,6002,6107,6404,6159,6
514,656
3,6850,6250,6595,6639,6923,6695,6971,7029,7292,6
319,6677,6743,7013,6799,7061,7109,7342,6862,7128
,7173,73
88,7196,7461,7471,7713,4368,5189,5228,5859,5510,
5899,5933,6356,5580,5980,6028,6417,6123,6472,654
8,6839,5
666,6064,6154,6488,6212,6572,6644,6912,6297,6690
,6634,6951,6761,7025,7075,7304,5887,6176,6235,66
01,6338,
6656,6737,7004,6395,6745,6797,7063,6830,7081,714
1,7380,6505,6813,6873,7119,6937,7182,7215,7436,6
982,725
6,7284,7491,7336,7525,7535,7667,5997,6242,6389,6
748,6468,6786,6815,7099,6541,6883,6900,7163,6956
,7185,72
68,7469,6559,6947,7008,7252,7072,7293,7301,7532,
7132,7346,7371,7557,7426,7609,7639,7779,6706,705
2,7066,7
325,7152,7350,7391,7571,7193,7433,7442,7633,7501
,7641,7718,7825,7235,7484,7518,7680,7564,7695,77
39,7860,
7589,7750,7774,7888,7802,7911,7929,8009,182,262,
280,412,303,417,473,634,331,452,496,673,550,722,7
49,1063,
366,478,511,720,582,765,849,1082,620,845,803,1128
,926,1178,1220,1552,389,552,602,795,627,841,887,1
139,690,
907,939,1183,1028,1264,1303,1637,730,956,1054,12
91,1079,1337,1381,1689,1125,1392,1446,1796,1481,
1848,192
9,2353,441,558,659,899,700,935,1018,1235,755,1059
,964,1304,1115,1356,1426,1725,820,1050,1119,1389,
1162,14
35,1469,1817,1206,1490,1563,1887,1632,1956,2032,
2485,898,1130,1187,1458,1268,1514,1596,1949,1323
,1603,16
86,2000,1731,2084,2144,2596,1405,1719,1805,2109,
1829,2147,2231,2688,1911,2264,2325,2757,2390,282
9,2945,3
511,524,656,707,1039,782,1072,1092,1424,855,1116,
1166,1454,1209,1508,1535,1941,923,1171,1224,1519
,1294,1
592,1671,2015,1352,1673,1723,2062,1811,2133,2214
,2656,976,1254,1329,1628,1361,1677,1745,2117,144
8,1802,1
835,2157,1909,2258,2300,2755,1524,1874,1951,2278
,2005,2376,2397,2823,2092,2446,2551,2913,2629,30
02,3177,
3513,1009,1341,1431,1757,1503,1823,1897,2272,155
7,1916,1967,2347,2033,2394,2481,2887,1661,2018,2
064,244
0,2150,2525,2611,3031,2202,2637,2710,3108,2779,3
209,3272,3789,1741,2121,2187,2563,2282,2654,2725
,3150,23
88,2748,2827,3239,2919,3286,3434,3941,2472,2850,
2947,3363,2989,3483,3543,4063,3163,3586,3647,403
8,3725,4
158,4312,4832,588,758,800,1158,858,1176,1240,159
0,866,1244,1308,1643,1371,1729,1762,2209,967,131
4,1376,1
787,1440,1808,1867,2211,1485,1866,1934,2318,2020
,2382,2415,2821,998,1430,1496,1792,1576,1878,195
5,2377,1
619,1987,2037,2424,2082,2514,2578,2977,1607,2068
,2127,2510,2200,2615,2664,3109,2289,2731,2784,32
07,2844,
3258,3381,3903,1067,1547,1577,1975,1654,2055,212
3,2487,1691,2142,2175,2603,2237,2683,2742,3201,1
924,221
7,2284,2704,2355,2771,2842,3247,2454,2867,2961,3
354,3039,3476,3555,4021,2051,2332,2429,2812,2508
,2911,29
71,3441,2585,3018,3064,3506,3180,3616,3674,4125,
2717,3172,3214,3649,3249,3728,3629,4198,3404,388
4,3942,4
340,3966,4525,4619,4934,1110,1648,1665,2195,1881
,2256,2298,2726,1979,2311,2360,2799,2452,2874,29
55,3448,
2039,2444,2499,2881,2558,2973,3047,3520,2638,307
3,3148,3600,3241,3665,3782,4221,2207,2517,2572,3
045,265
9,3127,3224,3633,2793,3226,3278,3767,3405,3719,3
916,4358,2905,3331,3464,3887,3526,3962,4030,4464
,3618,40
46,4044,4595,4205,4653,4731,5164,2327,2631,2733,
3230,2872,3284,3379,3814,2963,3442,3489,3949,357
7,3984,4
041,4515,3050,3537,3639,4022,3689,4056,4212,4660
,3808,4231,4305,4747,4413,4858,4926,5383,3202,36
55,3750,
4215,3911,4223,4389,4785,3934,4373,4479,4903,456
7,4994,5125,5558,3990,4533,4643,5033,4706,5142,5
081,561
0,4826,5227,5291,5766,5410,5848,5958,6234,666,81
1,890,1196,948,1318,1378,1748,995,1394,1443,1785,
1501,18
59,1872,2369,1006,1497,1539,1853,1580,2057,2097,
2468,1703,2103,2194,2588,2243,2668,2738,3234,101
5,1571,1
650,2078,1712,2189,2221,2650,1750,2270,2304,2750
,2374,2830,2898,3292,1804,2341,2410,2857,2492,29
53,3004,
3416,2531,2980,3080,3535,3102,3594,3657,4327,125
7,1707,1735,2239,1791,2306,2371,2807,1892,2417,2
459,292
7,2543,3025,3071,3458,1973,2466,2570,2996,2645,3
100,3117,3562,2702,3123,3142,3671,3326,3729,3862
,4365,20
43,2643,2676,3138,2769,3218,3232,3703,2837,3324,
33 88,3
807,3496,3904,3951,4486,2925,3432,3528,3959,3621

,4015,4136,4574,3744,4151,4237,4662,4308,4756,4879,5366,1279,1774,1861,2401,1961,2460,2556,3037,2026,2580,2652,3125,2719,3157,3186,3695,2140,2681,2762,3195,2835,3311,3370,3798,2920,3410,3491,3932,3564,3992,4093,4494,2225,2805,2896,3385,3008,3467,3461,3998,3052,3540,3591,4065,3709,4142,4177,4676,3155,3623,3736,4160,3800,4256,4311,4792,3881,4351,4436,4904,4589,5009,5134,5574,2292,2940,3023,3545,3115,3615,3713,4152,3307,3742,3825,4293,3837,4320,4407,4850,3334,3830,3878,4385,4007,4431,4547,4988,4117,4580,4637,5040,4728,5181,5241,5631,3412,4037,4078,4500,4191,4598,4652,5104,4239,4722,4801,5219,4882,5302,5396,5788,4445,4808,4911,5316,5026,5427,5479,5931,5110,5533,5604,5995,5696,6105,6210,6582,1367,1894,1992,2582,2129,2674,2753,3255,2163,2776,2853,3318,2931,3397,3519,4096,2277,2902,3032,3450,3085,3609,3571,4123,3130,3641,3721,4230,3816,4272,4333,4827,2494,3055,3132,3601,3303,3701,3753,4302,3316,3823,3855,4335,3909,4408,4461,4949,3338,3896,3977,4454,4111,4541,4626,5050,4168,4699,4725,5193,4804,5243,5339,5749,2537,3301,3310,3804,3348,3832,3927,4421,3427,4012,4072,4518,4144,4612,4713,5151,3734,4103,4197,4634,4246,4748,4811,5234,4415,4819,4917,5322,5032,5413,5470,5925,3848,4254,4382,4754,4446,4897,4963,5360,4559,5003,5065,5464,5143,5538,5625,6039,4645,5117,5209,5601,5287,5672,5743,6121,5377,5773,5842,6197,5884,6323,6341,6795,2565,3356,3395,4087,3696,4132,4174,4693,3774,4227,4286,4772,4400,4840,4941,5346,3869,4328,4439,4864,4509,4974,5072,5450,4618,5137,5058,5507,5235,5618,5695,6061,4118,4468,4540,5012,4670,5087,5200,5586,4740,5212,5284,5675,5331,5703,5795,6184,4886,5308,5390,5760,5485,5857,5912,6278,5552,5981,6026,6381,6111,6439,6459,6704,4248,4549,4732,5216,4834,5270,5309,5730,4931,5405,5433,5829,5514,5862,6000,6336,4956,5501,5593,5975,5690,6042,6056,6454,5779,6126,6169,6498,6260,6593,6650,6932,5158,5658,5679,6092,5813,6133,6202,6524,5878,6273,6292,6637,6398,6654,6808,7027,5946,6366,6427,6731,6512,6759,6848,7107,6557,6871,6921,7171,6980,7222,7263,74 67,988,1233,1283,1623,1344,1635,1766,2114,1418,1717,1820,2192,1942,2295,2345,2908,1511,1778,1851,2291,2010,2379,2535,2937,2087,2528,2449,3012,2671,3092,3160,3652,1568,1946,2048,2435,2101,2520,2600,3028,2228,2634,2692,3101,2847,3231,3290,3772,2308,2723,2894,3269,2933,3340,3408,3842,3009,3421,3500,3988,3553,4054,4155,4666,1694,1958,2167,2621,2247,2685,2832,3183,2361,2903,2740,3293,2993,3367,3474,3894,2478,2885,3000,3418,3068,3487,3533,4013,3140,3567,3668,4100,3764,4190,4283,4815,2619,3015,3105,3516,3236,3597,3717,4181,3321,3726,3839,4245,3902,4348,4423,4932,3438,3885,3999,4379,4027,4426,4522,5030,4134,4564,4631,5103,4705,5178,5298,5824,1884,2160,2261,2864,2407,2923,2951,3472,2544,2995,3076,3512,3145,3592,3631,4172,2666,3082,3167,3606,3276,3711,3820,4263,3360,3822,3892,4324,4005,4411,4504,4998,2759,3216,3329,3759,3377,3828,3918,4390,3503,3995,4035,4437,4130,4557,4604,5101,3613,4085,4183,4579,4252,4690,4714,5172,4357,4769,4887,5263,4969,5351,5519,5827,2818,3345,3482,3933,3584,4018,4115,4572,3660,4140,4202,4657,4285,4710,4809,5239,3805,4266,4326,4763,4429,4856,4948,5381,4492,4979,5055,5455,5126,5551,5608,6066,3913,4396,4475,4900,4584,4995,5069,5493,4703,5093,5175,5578,5267,5624,5758,6188,4798,5197,5300,5694,5337,5799,5853,6284,5505,5890,5943,6265,6011,6358,6477,6841,2023,2366,2445,3062,2548,3089,3192,3707,2561,3199,3299,3779,3392,3900,3938,4499,2745,3308,3401,3975,3493,4002,4077,4501,3559,4075,4163,4623,4269,4697,4736,5170,2797,3480,3574,3983,3686,4090,4188,4692,3748,4228,4290,4746,4345,4845,4914,5326,3731,4331,4404,4842,4491,4954,5007,5456,4593,5077,5132,5549,5192,5594,5709,6156,2916,3646,3688,4213,3796,4316,4398,4817,3845,4420,4459,4938,4530,5025,5088,5543,4149,4507,4587,5048,4668,5116,5190,5583,4778,5217,5313,5686,5388,5793,5863,6252,4309,4641,4752,5162,4839,5262,5321,5764,4921,5367,5411,5819,5522,5917,5965,6335,5062,5513,5556,5945,5585,6013,5929,6392,5727,6142,6189,6496,6207,6630,6698,6909,2984,3786,3811,4485,4094,4554,4602,5071,4219,4616,4674,5148,4777,5225,5307,5770,4294,4766,4830,523

3,4895,5323,5395,5834,4980,5419,5491,5904,5579,5
957,606
0,6408,4497,4848,4909,5393,5001,5471,5564,5932,5
140,5566,5615,6046,5729,6006,6167,6510,5256,5662
,5783,61
45,5839,6203,6258,6587,5918,6272,6270,6679,6397,
6720,6774,7054,4635,4972,5079,5569,5223,5622,570
8,6084,5
314,5765,5805,6194,5882,6220,6266,6622,5397,5847
,5937,6253,5979,6279,6402,6724,6080,6415,6471,67
83,6550,
6859,6903,7188,5544,5950,6030,6403,6163,6409,653
3,6812,6182,6522,6598,6890,6661,6949,7031,7286,6
226,663
5,6714,6974,6758,7041,7002,7315,6836,7092,7134,7
401,7202,7443,7499,7635,2179,2463,2607,3121,2707
,3313,34
03,3921,2790,3424,3497,3973,3581,4069,4082,4682,
2813,3576,3636,4060,3693,4318,4362,4793,3859,437
0,4483,4
924,4538,5010,5085,5573,2828,3678,3790,4342,3876
,4477,4512,4991,3924,4571,4609,5095,4687,5180,52
50,5629,
3997,4650,4729,5206,4823,5305,5353,5741,4861,532
9,5426,5845,5448,5898,5951,6485,3221,3866,3907,4
532,398
1,4611,4684,5157,4108,4738,4782,5277,4877,5375,5
417,5778,4209,4789,4908,5343,4986,5445,5462,5868
,5045,54
67,5486,5962,5657,6014,6125,6516,4300,4985,5018,
5483,5114,5559,5571,5994,5186,5655,5715,6079,581
1,6157,6
195,6603,5274,5755,5840,6201,5922,6247,6342,6665
,6025,6353,6419,6725,6473,6790,6875,7179,3252,39
56,4070,
4720,4195,4784,4893,5387,4277,4916,4993,5469,506
3,5500,5529,5986,4418,5023,5108,5536,5185,5646,5
701,607
2,5269,5734,5807,6180,5870,6228,6306,6609,4516,5
155,5248,5712,5358,5786,5780,6232,5400,5849,5895
,6286,59
98,6347,6373,6735,5498,5924,6019,6359,6073,6433,
6476,6817,6139,6504,6567,6891,6675,6957,7037,729
5,4596,5
292,5372,5855,5461,5916,6001,6354,5642,6023,6091
,6464,6103,6481,6545,6853,5665,6096,6138,6529,62
39,6562,
6647,6945,6327,6669,6709,6979,6772,7065,7101,732
7,5736,6264,6296,6613,6385,6682,6719,7017,6420,6
769,682
2,7088,6876,7139,7194,7412,6574,6826,6895,7147,6
968,7212,7241,7485,7022,7272,7312,7517,7363,7572
,7621,77
84,3386,4110,4234,4918,4406,5016,5098,5590,4442,
5122,5201,5651,5282,5722,5833,6309,4577,5253,538
2,5771,5
431,5910,5877,6333,5475,5939,6008,6414,6085,6445
,6490,6837,4825,5403,5477,5905,5639,5992,6033,64
70,5650,
6089,6119,6492,6161,6546,6586,6919,5670,6151,621
5,6580,6321,6642,6703,6984,6365,6753,6770,7074,6
823,710
3,7160,7393,4869,5637,5645,6076,5680,6098,6175,6
555,5750,6244,6291,6625,6349,6692,6763,7046,6018
,6315,63
91,6708,6424,6784,6828,7096,6552,6832,6898,7150,
6973,7204,7237,7482,6112,6431,6528,6788,6575,688
6,6930,7
175,6655,6954,6993,7234,7042,7275,7323,7540,6715
,7026,7083,7311,7131,7351,7390,7579,7184,7404,74
41,7615,
7463,7674,7681,7870,4902,5688,5721,6302,5987,633
9,6370,6747,6053,6412,6458,6801,6540,6846,6914,7
165,613
1,6486,6569,6864,6618,6936,6997,7226,6697,7038,6
989,7258,7097,7319,7362,7550,6328,6591,6641,6960
,6730,70
06,7078,7302,6779,7084,7130,7352,7155,7367,7416,
7610,6880,7142,7191,7398,7244,7447,7477,7653,728
2,7510,7
533,7700,7575,7725,7734,7835,6426,6649,6775,7087
,6843,7121,7143,7382,6907,7199,7217,7435,7262,74
50,7520,
7679,6925,7253,7306,7507,7359,7541,7547,7731,740
7,7582,7605,7751,7646,7788,7811,7918,7050,7344,7
355,756
6,7428,7585,7617,7760,7458,7650,7659,7807,7708,7
813,7874,7953,7492,7693,7719,7844,7755,7857,7889
,7978,77
76,7897,7914,7998,7936,8015,8027,8083,1250,1531,
1587,1970,1656,1982,2124,2504,1739,2073,2184,259
1,2316,2
699,2751,3342,1843,2137,2219,2694,2391,2787,2949
,3375,2475,2942,2861,3452,3097,3532,3603,4105,19
06,2322,
2434,2846,2489,2934,3020,3470,2626,3058,3118,354
2,3281,3677,3738,4224,2713,3152,3328,3715,3369,3
788,385
7,4296,3447,3872,3953,4440,4004,4506,4606,5105,2
045,2335,2559,3042,2646,3111,3266,3626,2767,3336
,3169,37
40,3429,3817,3923,4347,2892,3319,3436,3868,3508,
3936,3987,4467,3583,4016,4120,4553,4217,4640,473
4,5252,3
041,3454,3549,3971,3683,4050,4171,4630,3769,4180
,4292,4696,4355,4797,4871,5365,3890,4338,4452,48
29,4481,
4874,4968,5459,4586,5006,5075,5528,5147,5598,571
1,6205,2253,2553,2661,3297,2817,3358,3391,3920,2
960,343
0,3514,3965,3588,4043,4084,4621,3091,3522,3610,4
058,3722,4165,4274,4712,3810,4276,4344,4774,4458
,4859,49
51,5428,3189,3662,3777,4211,3827,4281,4372,4838,
3955,4448,4489,4885,4583,5000,5047,5526,4067,453
7,4633,5

021,4701,5130,5156,5592,4807,5205,5320,5678,5399,5761,5920,6208,3251,3794,3930,4388,4034,4473,4569,5015,4112,4592,4655,5097,4735,5153,5247,5653,4260,4716,4776,5199,4876,5290,5380,5791,4937,5408,5482,5860,5550,5949,6005,6422,4367,4844,4920,5333,5027,5425,5495,5897,5145,5518,5596,5976,5684,6017,6144,6538,5237,5620,5714,6083,5748,6179,6229,6621,5908,6263,6312,6607,6375,6689,6794,7118,2404,2773,2855,3502,2967,3530,3635,4162,2983,3643,3747,4233,3841,4353,4394,4945,3174,3756,3850,4428,3944,4456,4528,4947,4009,4527,4613,5067,4718,5138,5174,5589,3227,3929,4024,4434,4138,4543,4639,5131,4200,4681,4742,5184,4795,5279,5348,5738,4185,4780,4852,5276,4935,5385,5435,5861,5035,5502,5555,5947,5614,5993,6097,6508,3350,4099,4139,4667,4251,4765,4847,5255,4298,4868,4906,5371,4976,5454,5512,5941,4601,4953,5029,5476,5107,5542,5612,5983,5215,5636,5724,6075,5798,6174,6238,6596,4760,5084,5188,5581,5273,5676,5733,6149,5355,5777,5818,6200,5923,6289,6334,6668,5488,5915,5953,6314,5985,6377,6298,6718,6116,6493,6539,6814,6553,6935,6992,7180,3420,4241,4265,4929,4546,4997,5044,5496,4673,5060,5112,5568,5213,5644,5720,6153,4745,5203,5265,5649,5328,5735,5804,6214,5409,5826,5894,6276,5978,6326,6418,6734,4943,5281,5342,5802,5430,5876,5961,6301,5563,5964,6010,6407,6117,6369,6519,6827,5669,6057,6164,6495,6217,6551,6602,6894,6290,6612,6610,6976,6723,7011,7058,7300,5078,5402,5504,5967,5641,6015,6095,6442,5726,6150,6185,6542,6256,6566,6608,6928,5806,6225,6305,6597,6346,6617,6727,7014,6438,6741,6789,7068,6861,7135,7174,7415,5942,6318,6394,6729,6515,6736,6844,7091,6534,6834,6902,7158,6959,7210,7280,7497,6571,6940,7005,7233,7045,7289,7257,7523,7115,7335,7368,7594,7429,7629,7676,7783,2575,2876,3026,3566,3135,3761,3852,4376,3220,3874,3948,4425,4032,4519,4535,5121,3245,4025,4089,4511,4146,4768,4813,5232,4314,4820,4928,5357,4983,5439,5509,5971,3261,4129,4244,4791,4330,4923,4958,5421,4378,5013,5052,5521,5128,5599,5664,6021,4450,5092,5169,5627,5259,5718,5763,6128,5296,5740,5832,6223,5854,6271,6320,6805,3667,4321,4360,4978,4433,5054,5124,5577,4561,5177,5221,5693,5311,5785,5823,6160,4664,5229,5340,5754,5416,5851,5867,6243,5473,5872,5889,6331,6052,6378,6480,6831,4751,5414,5447,5886,5540,5956,5969,6357,5607,6050,6102,6437,6192,6509,6544,6906,5691,6141,6219,6549,6293,6592,6674,6963,6390,6685,6744,7016,6791,7073,7145,7405,3698,4410,4521,5161,4647,5222,5325,5796,4726,5350,5423,5874,5490,5903,5928,6351,4866,5452,5534,5936,5605,6038,6087,6430,5685,6122,6187,6531,6246,6573,6645,6913,4962,5575,5661,6100,5768,6166,6162,6578,5808,6227,6268,6624,6361,6678,6702,7024,5901,6295,6384,6691,6432,6757,6793,7094,6491,6821,6878,7159,6972,7219,7285,7506,5038,5707,5782,6231,5865,6288,6364,6686,6035,6388,6451,6781,6461,6800,6857,7129,6059,6455,6489,6842,6585,6874,6946,7207,6663,6966,7001,7236,7056,7310,7341,7531,6124,6606,6633,6917,6713,6978,7010,7271,6746,7053,7100,7331,7146,7373,7422,7604,6884,7104,7164,7381,7230,7438,7462,7664,7274,7486,7521,7689,7562,7736,7775,7904,3835,4563,4686,5352,4854,5444,5524,5990,4891,5547,5623,6045,5698,6110,6213,6648,5020,5667,5792,6155,5837,6283,6251,6666,5879,6308,6372,6740,6444,6768,6809,7116,5261,5810,5881,6277,6032,6355,6396,6787,6043,6449,6475,6811,6513,6858,6893,7187,6063,6503,6561,6889,6659,6944,6996,7240,6696,7040,7055,7318,7102,7343,7394,7586,5303,6029,6037,6435,6071,6457,6527,6867,6137,6589,6629,6931,6681,6988,7048,7294,6382,6653,6717,6999,6750,7069,7106,7338,6863,7111,7168,7384,7232,7431,7456,7662,6469,6755,6840,7071,6885,7154,7192,7403,6953,7216,7248,7453,7290,7488,7529,7709,7007,7278,7326,7519,7366,7552,7584,7741,7411,7597,7626,7769,7645,7815,7822,7969,5335,6078,6108,6640,6352,6671,6700,7036,6411,6738,6778,7082,6852,7123,7183,7397,6483,6806,6881,7138,6924,7198,7251,7446,6991,7287,7245,7476,7339,7526,7561,7716,6664,6896,6943,7221,7021,7260,7321,7513,7064,7328,7365,7553,7389,7565,7607,7764,7148,7376,7419,7591,7465,7634,7655,7799,7495,7684,7705,7836,7737,7858,7863,7941,6752,6948,7059,7329,7120,7358,7377,7578,7177,7427,7440,7620,7479,7636,7691,7820,7190,7474,7515,7682,7559,7710,7714,7861,7599,7743,7759,7878,77
92,7908,7926,8007,7298,7546,7554,7730,7614,7745,
7771,7884,7643,7798,7805,7921,7841,7927,7971,803
1,7671,7
832,7854,7951,7881,7957,7985,8052,7896,7989,8004
,8065,8020,8077,8087,8126,3210,3625,3704,4206,37
99,4222,
4399,4836,3912,4337,4471,4927,4622,5042,5096,567
3,4048,4416,4510,5037,4707,5135,5301,5705,4802,5
294,521
0,5772,5442,5843,5906,6316,4127,4628,4758,5194,4
818,5285,5369,5789,4966,5406,5463,5852,5617,5968
,6020,64
10,5057,5494,5659,6003,5700,6065,6120,6465,5769,
6132,6196,6570,6237,6616,6687,7018,4303,4644,489
6,5391,4
987,5457,5602,5926,5113,5668,5511,6022,5752,6086
,6172,6501,5245,5652,5759,6130,5821,6183,6222,65
90,5888,
6248,6329,6651,6405,6712,6776,7108,5389,5775,585
8,6211,5973,6274,6367,6705,6048,6376,6463,6749,6
507,681
9,6869,7178,6147,6494,6579,6838,6600,6870,6933,7
231,6673,6955,6998,7270,7044,7308,7370,7618,4551
,4889,50
04,5634,5167,5689,5717,6170,5312,5753,5828,6206,
5892,6269,6300,6699,5437,5835,5911,6281,6009,636
3,6447,6
762,6081,6448,6499,6803,6583,6860,6920,7213,5531
,5955,6055,6401,6093,6453,6521,6845,6198,6576,66
05,6879,
6670,6952,6983,7269,6287,6638,6707,6965,6754,703
4,7049,7305,6825,7080,7149,7354,7195,7399,7480,7
619,558
7,6069,6178,6532,6261,6594,6662,6962,6322,6676,6
721,7012,6777,7047,7105,7340,6436,6764,6804,7077
,6872,71
33,7186,7413,6911,7200,7242,7448,7281,7494,7522,
7717,6517,6849,6899,7156,6969,7211,7249,7470,704
3,7264,7
307,7508,7356,7528,7590,7765,7098,7320,7372,7560
,7392,7608,7631,7801,7475,7647,7669,7794,7697,78
29,7869,
7982,4723,5119,5204,5816,5318,5841,5934,6360,533
2,5940,6027,6416,6106,6506,6536,6916,5516,6036,6
114,656
0,6190,6581,6632,6918,6241,6631,6693,6994,6766,7
039,7060,7303,5567,6177,6254,6565,6344,6643,6711
,7035,63
93,6739,6780,7067,6818,7126,7166,7386,6379,6807,
6855,7125,6910,7189,7218,7449,6975,7254,7283,749
3,7317,7
516,7568,7753,5682,6311,6345,6728,6428,6796,6851
,7110,6467,6866,6892,7181,6938,7229,7261,7489,66
84,6922,
6970,7239,7019,7277,7316,7511,7086,7330,7378,755
6,7418,7606,7637,7789,6792,7003,7070,7299,7122,7
353,738
3,7592,7170,7406,7430,7616,7481,7657,7678,7819,7
246,7478,7496,7670,7512,7698,7663,7839,7576,7748
,7766,78
77,7773,7919,7939,8001,5744,6421,6440,6905,6646,
6950,6981,7250,6732,6990,7023,7291,7085,7334,737
5,7595,6
782,7079,7117,7337,7153,7385,7421,7623,7201,7434
,7468,7651,7509,7675,7715,7845,6915,7127,7162,74
20,7214,
7457,7500,7665,7288,7502,7524,7711,7577,7694,775
8,7880,7349,7548,7601,7749,7624,7772,7791,7906,7
658,779
7,7796,7934,7840,7947,7962,8039,7000,7197,7255,7
503,7332,7527,7567,7726,7379,7593,7611,7767,7644
,7778,77
95,7916,7423,7628,7666,7790,7683,7800,7842,7948,
7724,7849,7866,7965,7893,7987,7999,8069,7490,767
2,7706,7
843,7757,7846,7887,7972,7763,7883,7909,7994,7930
,8011,8032,8091,7780,7920,7944,8018,7956,8035,80
25,8097,
7980,8047,8056,8113,8073,8121,8131,8152,4912,522
6,5376,5871,5480,6040,6115,6523,5561,6135,6193,6
558,625
9,6626,6636,7028,5582,6255,6303,6619,6350,6798,6
829,7095,6478,6833,6904,7172,6942,7220,7259,7505
,5597,63
37,6423,6816,6487,6901,6926,7208,6525,6961,6986,
7266,7032,7309,7347,7530,6577,7009,7057,7324,711
3,7374,7
400,7583,7136,7387,7437,7627,7445,7649,7673,7872
,5959,6482,6511,6939,6564,6987,7030,7297,6657,70
62,7089,
7361,7144,7410,7432,7598,6726,7093,7161,7395,720
6,7444,7452,7638,7238,7454,7466,7677,7545,7699,7
742,788
2,6785,7205,7225,7464,7276,7498,7504,7688,7314,7
544,7570,7723,7613,7754,7768,7910,7360,7588,7625
,7770,76
60,7787,7823,7931,7704,7827,7850,7949,7867,7968,
7990,8067,5988,6547,6627,7051,6716,7090,7151,741
7,6771,7
167,7209,7455,7247,7473,7483,7685,6865,7228,7273
,7487,7313,7539,7563,7720,7357,7580,7612,7762,76
40,7781,
7809,7912,6929,7296,7345,7569,7402,7602,7600,778
2,7424,7630,7648,7803,7690,7824,7834,7952,7472,7
661,770
2,7830,7721,7856,7868,7973,7747,7879,7899,7995,7
933,8013,8033,8092,6977,7369,7408,7632,7451,7656
,7692,78
28,7537,7703,7729,7864,7735,7871,7891,7986,7549,
7732,7746,7886,7785,7898,7924,8010,7816,7932,794
3,8019,7
961,8040,8050,8100,7581,7793,7806,7913,7837,7935
,7946,8028,7851,7959,7974,8046,7991,8057,8071,81
16,7901,
7976,7996,8060,8016,8075,8081,8129,8029,8088,809

6,8134,8107,8142,8151,8171,6101,6658,6742,7169,6856,7223,7267,7514,6882,7279,7322,7543,7364,7574,7622,7810,6964,7348,7414,7596,7439,7654,7642,7818,7459,7668,7696,7848,7727,7859,7875,7981,7114,7425,7460,7652,7536,7687,7707,7865,7542,7728,7740,7876,7756,7892,7905,8003,7551,7752,7777,7903,7814,7923,7940,8021,7831,7955,7960,8041,7975,8051,8063,8111,7140,7534,7538,7722,7555,7733,7761,7895,7587,7786,7804,7917,7826,7937,7958,8037,7701,7812,7838,7942,7852,7966,7977,8048,7894,7979,7997,8061,8017,8074,8080,8128,7738,7855,7885,7967,7902,7993,8006,8066,7928,8012,8023,8079,8036,8089,8099,8137,7945,8030,8043,8095,8055,8102,8110,8144,8068,8114,8120,8149,8125,8157,8159,8179,7157,7558,7573,7808,7686,7821,7833,7954,7712,7847,7862,7970,7890,7984,8002,8064,7744,7873,7900,7988,7915,8008,8024,8078,7938,8034,8022,8085,8049,8098,8106,8140,7817,7907,7922,8014,7950,8026,8042,8093,7964,8044,8054,8103,8062,8108,8117,8148,7992,8058,8070,8112,8082,8122,8127,8155,8090,8133,8136,8161,8143,8164,8166,8176,7853,7925,7963,8045,7983,8053,8059,8109,8000,8072,8076,8119,8086,8123,8135,8158,8005,8084,8094,8132,8105,8138,8139,8165,8115,8145,8147,8167,8153,8172,8174,8184,8038,8101,8104,8141,8118,8146,8150,8169,8124,8154,8156,8173,8162,8175,8180,8186,8130,8160,8163,8177,8168,8178,8181,8187,8170,8182,8183,8188,8185,8189,819 0,8191]

**Sequence group 4: Q4_16384**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1024,520 ,288,528,192,544,70,44,131,81,50,73,15,320,133,52,23,134,384,76,137,82,56,27,97,39,259,84,138,145,261,29,43,98,515,88,140,30,146,1025,71,262,265,2048,161,576,45,100,640,1026,51,148,46,75,266,273,517,104,162,53,193,1028,152,77,164,768,268,274,518,54,83,57,521,112,1032,135,78,289,194,85,276,522,58,168,139,99,86,60,280,89,290 ,529,524,196,141,1040,101,147,176,2049,142,530,321,31,200,90,1056,545,292,322,532,2050,263,149,102,105,304,4096,296,1027,163,92,1029,47,267,385,546,324,2052,208,386,150,153,165,106,55,328,1088,536,577,548,1033,113 ,154,79,269,108,578,2056,224,166,519,552,195,270,1030,641,1041,523,275,580,291,59,169,560,114,277,156,87,1034,197,116,170,2064,61,1042,531,525,642,281,278,526,177,293,388,1152,91,584,769,198,2080,172,120,201,336,62,282,4097,143,1036,1057,103,178,294,93,1089,644,202,2051,592,323,392,2053,297,770,4098,107,180,1044,151,209,284,1280,648,94,204,298,400,608,2112,1058,352,325,533,155,210,305,2057,4100,547,300,109,1048,184,534,1060,537,115,8192,1031,167,225,326,2054,306,772,157,2065,656,329,110,117,212,171,1153,776,1090,4104,330,1536,2058,226,549,1035,538,387,308,216,416,271,279,158,337,2066,550,672,1064,118,332,579,540,1092,2176,389,173,1154,121,553,199,784,179,228,4112,338,312,1043,704,1037,390,174,554,581,1072,393,2060,283,2081,122,448,353,2113,561,1038,203,63,4128,340,394,1096,1281,527,582,556,181,295,1045,285,232,124,2068,205,182,643,2304,1156,562,286,585,4099,299,354,2082,1059,4101,211,401,1282,185,1050,396,344,586,645,1537,593,535,240,8193,2072,1104,206,95,327,2084,564,800,402,2055,4160,356,307,301,417,1061,213,1049,568,1046,832,4105,588,1160,8194,1284,186,2177,646,404,2114,1288,227,896,594,418,2560,302,649,771,360,539,2059,4102,111,1062,331,1538 ,4113,214,309,1120,1091,2088,188,8196,449,1065,217,408,609,596,2116,551,650,229,159,4106,420,2178,310,1168,541,1052,773,610,657,333,1093,119,1066,2067,4114,2061,600,339,1540,218,2096,368,652,1073,230,391,313,4224,450,8200,542,1098,334,1296,233,555,2062,774,175,123,1184,658,2120,612,341,2305,777,220,314,2069,1544,424,1312,395,4108,673,4129,583,355,1552,2180,1216,4161,287,183,234,1568,125,557,1094,660,616,342,316,2083,1068,241,778,2306,563,8208,2074,1155,345,452,397,2561,4116,403,1105,207,2128,1074,4352,674,558,785,1097,432,1039,357,187,1344,236,664,1157,624,4130,587,780,1076,8224,2085,1047,705,2073,126,242,2070,1158,565,398 ,2184,346,456,2308,4120,358,405,303,569,2312,1408,4132,244,1100,1161,595,1106,189,4103,566,676,1080,8195,1051,1121,361,2086,706,8197,589,2562,1063,215,786,647,348,2144,2115,419,406,464,680,4225,801,2089,4162,1283,362,1108,590,409,1162,4608,570,1169,788,1285,2192,1053,4107,2076,597,1067,8256,572,1122,219,31

1,2117,7
08,598,2090,1539,601,651,421,792,4136,802,8201,25
64,611,1112,602,1164,410,231,2097,4164,688,653,10
54,248,
1170,2122,4226,369,2320,190,364,1095,654,2208,12
86,8198,659,1289,335,480,4115,315,4109,221,3072,8
209,370,
1185,613,2568,1600,4144,422,425,2336,451,1069,61
4,543,1124,235,412,2576,343,372,2240,1664,775,317
,2592,41
10.8202.2118.1075.222.1172.426.4168.2092.453.435
3.237.1070.559.1099.2179.1290.4117.833.8210.804.7
12.1297,
834,661,1541,808,779,2129,1128,617,604,2098,1186,
433,4228,720,2121,816,1077,8320,2063,1217,836,23
68,347,8
97,2181,1176,4131,243,1101,2100,662,4354,2071,11
88,4122,454,318,675,1792,618,2182,1292,4609,898,7
81,1298,
1542,376,428,1078,665,4176,736,8204,567,1107,822
5,2432,1081,1545,840,2124,2185,625,8257,238,2130,
1136,35
9,457,2104,399,787,2075,2145,4133,591,678,434,412
1,677,2087,1159,4118,1102,349,1313,1218,245,4232,
1109,45
8,4356,666,1300,620,1546,8212,1082,2307,1192,436
0,363,2132,127,1163,8448,191,2186,1123,782,407,21
93,436,6
26,2309,2077,1110,571,465,681,2091,246,4134,707,8
226,2146,4610,1084,350,1304,599,668,2563,1113,41
92,4163,
790,1314,1553,460,1548,2136,1220,4137,249,2188,6
82,1165,8216,573,1125,411,803,2078,1171,8228,789,
2194,12
00,709,365,4240,440,628,4124,689,3073,8199,2119,3
74,1166,423,2310,1554,4165,466,793,2313,4138,134
5,250,37
1,1055,481,574,1224,2209,4612,413,2624,1114,603,3
66,2093,1569,4145,8321,2148,1316,1346,8258,468,1
556,655,
900,4170,2688,805,4368,615,3074,8704,1287,684,11
73,710,2099,1126,4256,429,8203,794,2196,252,1129,
373,605,
1328,848,690,2094,5120,2123,713,632,2314,1320,48
2,4616,806,2321,4384,1187,8232,2565,1116,427,215
2,1071,9
04,4624,2210,1291,8260,4288,414,1409,2101,223,15
70,4640,2241,1348,4166,663,3076,8322,692,835,123
2,619,47
2,2200,1410,4140,455,796,2125,1174,1177,809,714,2
212,1189,721,4227,837,8211,2816,716,1130,8205,23
16,1079,
1352,864,2322,2566,4177,8240,810,2102,1560,4146,
606,1601,2131,912,4169,2105,2569,1572,4111,722,6
96,377,4
416,1137,435,2160,1178,4229,1103,8206,817,1293,1
132,319,621,4148,1602,812,4119,484,3080,8264,124
8,430,11
90,8449,2183,1543,2126,1576,4230,838,2337,2242,6
67,1219,8213,488,2133,1294,239,378,2324,2570,459,
622,210
6,2216,1665,4480,627,437,2187,380,4172,4233,8324,
2147,1547,4178,1299,818,1604,1315,461,4152,2134,
1083,41
23,496,4193,669,1193,1584,679,1138,8227,1301,210
8,1180,4135,724,8450,2328,841,1111,8218,629,2137,
1221,35
1,467,2338,2577,1140,8705,438,2572,2244,1194,737,
251,4355,462,2189,442,4180,441,3088,8272,2149,42
34,1085,
469,2195,1555,4241,247,683,2224,1549,4357,1666,4
125,842,1305,1302,738,4139,1550,2190,1201,4194,8
99,2578,
1317,670,1412,8229,783,2369,1115,4611,8217,849,2
079,1608,1793,8214,820,2248,1222,728,928,4184,21
38,8328,
791,4236,367,3104,8452,2593,1196,901,1144,630,23
40,2370,1225,4126,685,8456,844,2580,4242,1360,63
3,711,10
86,253,691,2311,1306,5121,2197,4167,824,2150,116
7,902,4358,686,2153,1127,4361,1202,8230,2352,131
8,1117,8
706,740,6144,1668,850,375,4257,2344,1226,8288,46
72,444,3075,8259,1616,2211,470,1347,4141,483,214
0,1416,4
196,415,3077,8233,485,2095,905,1321,795,473,2315,
1794,4736,634,744,2433,5122,2594,1131,852,960,23
72,1204,
865,4147,693,8336,2256,4244,1175,8220,2434,1233,
1308,797,2198,2201,1672,4142,8261,4171,2213,1118
,1228,82
34,4362,906,1322,2154,715,1424,4369,2103,2376,16
32,4613,807,3136,8708,474,636,4200,1376,694,254,2
584,134
9,4258,1557,8241,717,2625,1179,1234,575,913,4149,
2596,1329,798,4289,811,3081,8266,5124,2161,379,1
571,846
4,2202,1324,2127,1133,4248,697,2317,2156,4173,12
08,8352,431,2626,1558,4260,607,2272,1561,2214,48
9,4864,2
567,2600,1139,9216,4364,866,723,2243,486,4370,11
91,4614,8712,2318,1249,4150,1350,3078,8480,908,1
330,1796 ,718,813,4179,2689,1181,4153,476,4617,85
6,3089,8720,1680,1353,839,1134,8384,2571,1141,23
23,1236,4208,725,
8736,2628,2339,698,1195,8262,914,2107,1800,752,8
68,2217,2608,5128,2162,8236,819,2325,2204,1354,4
231,814,
4174,439,2135,929,4385,4290,3082,8323,2245,1250,
4181,1573,490,2164,1562,4372,1411,623,4618,2218,
1332,415
4,1240,8273,4264,671,1440,1295,739,1303,4235,824
2,1182,2109,1361,4195,916,3090,8265,2579,1574,46
3,1696,8
207,843,2573,2690,1142,4182,8512,381,2329,2326,1
356,1603,8325,497,2574,2225,1564,930,821,4156,23

41,8244,
2436,726,4376,961,3200,8215,2139,1413,4185,1197,
872,2632,2817,1145,4386,4625,8326,492,2246,1577,
4620,122
3,4292,631,1808,1203,729,4237,2220,1252,5136,216
8,1362,4197,700,2249,1336,443,4243,1728,8576,741,
2384,14
14,4272,1198,8268,8329,2110,1578,1605,8274,845,2
330,6145,1417,920,382,4238,2191,3084,8248,1307,8
219,4626 ,822,3105,8289,2151,1146,2226,851,1472,4
417,730,2342,2141,1377,4127,498,3137,8231,880,26
92,4296,1585,742,
445,2250,1227,4186,471,635,2640,1087,5152,2371,1
364,4641,932,2440,1418,687,4388,4418,8451,2345,1
551,4628 ,1606,8276,2818,1580,1205,1319,8330,903,
6146,2155,1309,4359,8337,825,4245,2228,1256,1148
,8453,4198,500,3
092,8221,1229,2199,846,1206,4201,2257,8235,2332,
1667,4400,745,3328,8290,826,2696,732,1586,446,96
2,2142,2
252,1310,4392,1609,8707,936,2346,5123,2448,1323,
475,853,4259,2656,1378,867,4188,637,3106,8280,51
25,2400,
4143,1235,8332,2373,1425,2581,1209,4363,907,2203
,2258,1420,4481,1368,8222,4642,2353,1610,1669,83
38,4420,
487,6148,1617,2595,695,1559,4304,2348,2157,1264,
9217,4482,746,3096,8263,828,2232,753,4246,1230,4
249,8454 ,854,2582,1119,4261,1351,3108,8457,857,2
585,1588,1824,504,799,4202,2163,10240,1426,4151,
255,4424,964,307
9,8353,5184,2215,1380,909,1331,8768,2273,1325,23
74,1441,4632,719,8237,2354,2820,4673,1237,8292,4
77,2205,
1592,4644,915,2704,2377,1856,5129,2158,8832,4209
,2165,2260,1612,9218,4250,638,4175,748,2219,944,4
365,121
0,4204,3201,8243,2824,1670,4674,1428,3138,8340,8
69,6152,1251,4320,1920,491,699,4262,2378,1618,46
15,1442,
8238,4648,754,3584,8267,1326,1673,858,1795,4291,
8458,2274,1384,2597,1563,4366,478,3083,8465,2586
,5126,24
35,968,1135,8709,383,2356,2264,1355,4737,8296,91
0,2464,2319,5137,2327,1238,8354,815,2206,2385,13
33,4619,
976,4371,2598,8245,2720,870,4676,4387,3112,8385,
2166,1212,9220,4155,1473,917,2380,2627,1241,4265
,1432,46
56,8344,4210,2588,1633,4373,1620,3140,8269,4252,
727,1575,1674,493,1253,4183,8356,2437,1183,5130,
2221,144
4,4293,873,3202,8960,2169,1334,701,4212,1565,846
0,931,2601,2247,1797,4266,1634,8466,8710,2832,22
27,1681,
1357,8246,756,2276,6160,2386,1143,860,499,4157,2
360,3091,8275,5138,2752,8249,4627,731,3085,8713,
2438,162
4,2222,4621,1363,4738,823,2602,2629,1242,4377,43
74,3120,8304,922,2441,1392,4622,1676,4273,874,23
31,1254,
4389,1415,918,4484,2170,1337,5248,2496,1474,9224
,4187,502,2401,1566,933,4680,1358,4865,8327,8270,
2609,12
57,4294,1579,8481,3086,8386,2251,1798,1199,1147,
8277,743,2111,6176,2388,1682,4268,8468,760,4216,
2442,314
4,8714,1636,1365,8250,4297,881,3329,8360,2575,18
01,2630,494,1244,4432,2604,8331,2229,2343,1338,4
158,702,
3093,8291,921,2333,4378,1448,501,876,2280,2172,1
419,4239,5132,8278,847,2253,1697,5153,2230,1607,
4199,992 ,4274,2691,1379,447,4390,4189,3204,8252,
5185,2610,1311,4740,1207,8472,2334,1258,2633,114
9,4298,1581,8281 ,733,6147,2347,1684,4688,1640,84
82,8721,4419,2402,1366,1340,8716,4488,827,3107,6
149,8388,1265,2259,934,1
802,4393,2449,3330,8333,2233,1587,9232,4866,882,
3098,8293,937,2444,2392,963,1369,4203,8339,747,2
634,2693 ,1476,4276,1421,3585,8368,505,2641,5140,
2583,1427,855,924,4247,2288,10241,1231,4305,734,
4380,829,3152,83
34,5376,2254,1698,4744,1582,8722,2143,1809,2375,
1456,4190,4300,8513,2612,2848,1381,4394,1211,822
3,4496,2
450,1260,1688,8392,4704,965,6208,2404,1648,5154,
2355,8282,1611,4448,2349,2465,1804,9248,4421,938
,4629,31
09,8737,884,2261,506,4251,1729,4306,3097,8484,85
14,2616,1150,4401,1266,3094,8724,749,2880,6153,1
589,1422 ,945,966,4643,2636,3208,10242,1370,4396,
1480,8455,4205,755,3332,8341,5144,2234,1382,859,
1429,4280,8294,2
694,1327,2452,1593,4630,940,3336,8297,2275,5156,
2944,4633,1268,8496,830,2642,2466,1619,4211,1228
8,911,23
50,2697,1213,5127,2819,1590,8488,4263,2408,2587,
1700,9219,4321,871,4422,6150,8355,2159,639,4402,
1385,486
8,3110,8284,2379,1730,9221,4253,1613,3586,8239,8
88,6161,2262,1239,4752,1810,4425,8459,479,4206,2
357,1671 ,4213,1372,3168,8577,4308,946,3139,8738,
1443,1430,750,1488,4267,8516,2236,10244,1704,524
9,2497,1825,4872 ,969,3113,8400,2265,5186,2456,50
8,1386,8578,861,2657,2644,1614,4426,1433,8342,83
45,2599,2698,5632,2277,1
594,8357,757,2207,6154,2468,1812,4322,970,4645,2
358,3216,8298,5131,2589,8247,4634,4483,3100,8520
,2821,16
21,2658,9280,4404,1596,4312,919,2705,2381,1243,4
512,1335,4367,3141,8728,4375,2167,1732,4254,1622
,3114,87
69,4433,875,6162,1625,4646,1675,862,1445,4768,87
40,2648,1816,5160,2387,1826,9225,4214,758,3588,8
305,2266 ,1635,948,4428,1626,4675,8346,8271,2416,
2700,1434,4636,1255,8461,3121,8300,2278,5188,243

9,1712,1677,8770 ,977,2361,6272,2498,10248,1272,4
485,8416,923,4269,2590,3146,8358,5250,2382,1393,
8711,4217,972,3344,8744,
2281,1214,2603,4649,1388,4295,2822,8387,2223,217
1,1678,4880,4275,3232,8462,761,2706,9222,4324,16
83,4434,
877,2660,2389,1359,4408,1504,5139,8833,4800,2825
,1339,5133,2268,1245,9233,4486,952,4270,2362,139
4,495,46
50,1637,4677,8715,3592,8467,5168,2472,1446,4489,
1449,8772,3360,8483,2443,1475,6156,1638,4379,156
7,8251,7
03,2721,6177,2631,1259,4218,1436,8361,8752,4544,
2403,3600,8306,1367,1396,8469,4449,935,3264,6209
,8348,23
35,1799,2231,978,1341,4657,2282,3616,8279,2173,5
134,2605,9226,4299,883,3142,8389,762,2708,2664,4
159,1246 ,4436,8308,503,2390,2364,1450,4490,5192,
3116,8362,925,2289,1477,5377,2826,1261,4623,878,
4678,2611,10256,
1583,4652,735,4277,4391,3203,8253,5141,2393,1857
,9234,4381,1828,8723,2500,1736,2445,1858,4328,16
85,4220,
8717,8834,6164,2451,1832,4301,1803,8473,3153,847
0,4278,2255,1641,1628,8718,4739,993,3122,6400,83
69,2722,
1457,5252,2606,8485,1744,4658,2833,3145,8580,248
0,1840,9344,4382,885,4681,3087,8283,939,2405,223
5,994,18
60,4395,3392,8776,8961,2284,2712,1371,4450,1921,
3205,8390,980,2672,6178,5155,2635,1267,926,764,4
307,2828 ,3124,10272,1686,4497,5378,8364,4281,94
1,3095,8312,5146,2753,1478,4492,1342,4440,8393,2
174,1699,2290,164
2,4682,4741,3206,8528,2613,5633,2446,1922,4689,1
805,8254,4631,2394,2504,1400,4336,1452,8474,1228
9,967,61
68,2406,1689,5200,2453,1760,8335,9228,4302,2351,
2617,1591,9249,4191,886,4423,3456,6180,8295,8370
,2292,83
1,4660,1864,4896,3148,8486,3209,8285,2643,1649,9
281,4498,1262,3154,8836,947,2237,6151,2614,1383,
1481,445
2,8394,507,4403,2724,3128,10243,1423,4397,1811,3
099,8784,4513,889,3169,8515,5157,2409,1615,984,1
702,4309 ,8584,2754,10245,1458,5145,2637,1701,46
64,751,3111,8489,2263,5142,2834,4928,1373,8962,9
42,2695,2396,1269 ,4684,5256,12290,8299,2467,245
4,1482,5380,2512,1690,8372,4282,2728,6273,2849,1
644,9236,4742,996,4500,621
0,3331,8343,5384,2410,8401,4323,1387,4992,3156,8
476,2638,1151,2457,9472,4690,1215,4514,3210,8840
,971,665
6,2618,1806,4398,1431,4745,3217,8286,8396,4867,2
836,1460,4456,1650,3333,8490,4635,890,3101,6155,
8592,159
5,1489,509,1705,4207,8800,2645,3115,10304,1270,5
158,2620,1731,9250,4427,949,3170,8544,2267,5634,
2359,973 ,1374,4310,8517,8725,2756,2646,1623,440
5,1692,8347,3587,8402,2649,5216,2699,5187,2469,1
814,8497,1000,284
0,6184,2850,10249,1484,4284,12292,892,4545,2659,
3160,8739,5161,2650,1273,8492,4313,4504,3212,830
1,2458,1
706,2279,9240,4705,1597,4692,6212,8376,2736,2701
,1435,4647,1827,4746,3102,8726,4325,2296,9252,42
55,1813,
3218,8729,4516,950,6274,2417,1733,4406,1389,5264
,8307,1464,4637,2238,1652,5148,2412,1713,9223,48
69,863,4
706,3143,8359,2702,1398,759,4753,1447,4429,8417,
3334,8518,10246,5189,2707,1490,4215,1817,8498,33
37,8964,
2383,5162,2528,6163,1274,1395,8349,1008,2363,615
7,2269,10257,1505,4696,1598,8848,8521,4435,2418,
3233,83
02,5636,2661,1437,8309,4314,510,3648,6192,8404,2
470,1627,2473,4464,1390,4748,2499,3117,8363,2662
,5169,25
91,9345,4326,4487,3172,8968,979,2283,2460,9282,4
409,1492,4546,12296,953,2391,2420,1679,4638,1924
,5194,37
12,8522,4430,2823,1829,5392,2365,1639,9728,4329,
763,4651,6158,10250,1708,4870,974,4271,1734,4219
,8418,31
23,8741,5280,2270,1453,9227,4754,1818,8730,3220,
8579,2474,1276,6216,1397,4708,1629,4437,8500,840
8,2501,6
401,2285,1872,4873,1714,8608,3118,8463,4316,2607
,3147,8471,1737,1656,8350,4410,954,3338,6165,852
9,2881,1
0258,1506,5640,2852,8742,1830,4520,2760,3345,886
4,2882,5408,2709,9256,4491,879,3589,8310,981,285
6,2827,4
769,1451,4679,3176,8524,8771,2665,2652,1928,4451
,5648,3234,8732,982,2481,6276,9284,5312,2768,143
8,4383,9
27,4279,2864,3125,10368,1247,4330,5664,8581,4221
,4653,3265,8365,5190,2884,1687,9346,4756,1716,47
12,8313,
2395,1859,2945,1643,4438,1496,4412,8745,3224,839
1,6179,5164,2291,1479,4337,1820,8976,3149,8371,4
874,271
0,6402,1833,4659,1738,8420,12304,995,3236,6170,8
530,2502,1745,5251,2366,1861,8504,9235,4441,2723
,3840,88
96,2666,1740,9229,4548,765,4493,3340,6657,8582,8
366,2946,2829,956,1888,4499,3346,8746,3590,8773,
2424,520
1,2476,9264,4303,1834,3126,8585,887,2713,6224,27
84,5170,10252,1630,4770,8475,985,4654,2615,3155,
10273,19
36,4881,5193,3129,8314,4528,997,3593,8640,5135,2
888,1746,4453,1720,4283,8545,2673,10305,1401,544
0,2286,1
459,4332,4760,3184,8753,2407,5253,2505,9230,4720,1841,8395,4683,2447,2835,1343,4876,1645,5172,82
55,1232
0,8532,6181,2639,1836,5143,2726,1508,8586,9288,4
801,2482,6169,2725,1454,9473,4222,986,4338,3207,
6166,871
9,3150,8774,5254,2397,8748,4661,1862,4494,3361,8
373,3266,8487,2293,1691,6280,9237,4442,1512,4552
,3157,84
77,943,2506,6404,2714,1263,1402,4454,3348,8424,8
316,4501,2668,3594,10260,1483,4399,1646,3130,839
7,4665,8
91,3240,6408,8374,5504,2411,1651,998,1461,4340,8
835,2175,3211,10496,1404,5196,2239,5257,9348,469
1,766,31
71,8754,2830,5202,2455,4285,1842,4662,8478,8777,
2484,2674,1485,4772,5176,12291,3158,8491,2619,51
47,2513,
1520,5217,2729,1693,8546,4457,2294,6182,2755,102
74,1703,4802,9251,12293,511,4685,6658,3132,8403,
5159,23
98,1748,8593,4311,9474,4882,3352,8377,2647,1865,
2716,9242,4743,1653,4444,3161,6240,8588,8536,621
1,2838,1
375,4515,1491,4502,3362,8778,3601,8837,4560,2508
,9729,4776,1462,3596,8785,4897,988,3268,6185,872
7,2297,1
761,1275,5379,8432,1486,4458,2730,3213,10264,146
6,5204,2621,1465,9296,4686,1001,4505,3173,8398,2
459,525
8,2851,951,1493,4666,8287,3219,8519,10276,5265,2
837,1271,4884,1707,8756,3248,8992,2757,5381,2413
,6288,51
49,2488,1866,8594,1002,2676,6172,2737,10247,1762
,4693,5163,12352,8548,4668,2422,3214,8499,5218,2
471,192
3,8493,4315,4407,3602,6213,8609,2514,1694,2841,9
253,4804,1807,4694,6186,3393,8405,2298,5635,2419
,9241,46
97,1873,4747,3103,8760,4517,2529,2622,9238,4888,
1844,4898,3272,9024,12297,893,6660,2461,1752,470
7,1952,5
208,3162,8780,9352,4698,2651,1815,5260,2414,1391
,9476,4506,975,4327,3617,6193,8378,10369,1925,89
4,4784,1
654,4749,8838,3364,8596,3394,10306,5150,2516,170
9,9480,4344,1868,8419,3604,9088,2703,5266,2948,6
218,165
7,1735,4465,8786,8610,2853,6416,2663,10752,1277,
4286,1715,8494,3335,8841,4460,2732,3221,8963,519
1,2758,1
848,8552,4750,1009,3174,6304,8731,2477,10251,192
6,5382,2842,12294,1710,4755,2300,3177,8303,2421,
5385,26
53,9254,4431,4576,3376,8523,955,2896,2738,9730,4
411,1764,4317,7168,12305,8406,2761,2680,1874,446
6,1399,5
281,3368,8501,4709,2530,6664,9312,5696,2854,1468
,9283,4518,1004,4521,6432,3235,10280,1494,4547,5
165,838
0,4710,1507,4639,3164,8641,5220,2475,1439,9257,4
331,1509,4508,8409,3119,8600,2952,1929,6672,1819
,4439,14
97,4468,8801,3339,8788,10308,6336,5760,2462,1658
,4871,1768,8743,3457,8842,4413,2271,3618,6688,84
21,1876,
1984,8351,12298,1010,3396,6214,8612,2711,10370,1
889,5171,2740,1717,8502,9360,4318,2883,3280,8733
,2667,5
268,2520,9244,4522,957,3458,6188,8965,8802,2503,
2844,4549,1821,4333,3222,8849,3225,8525,2857,516
6,2762,9
285,4655,5195,3237,8311,983,2769,6275,2885,9258,
5386,10259,1930,4929,12306,958,4900,2764,3178,10
253,173
9,4808,5393,3127,8792,4930,4757,3400,8531,5637,2
912,1831,9732,4904,1498,4875,8410,6225,10288,166
0,5224,2
858,1718,4713,1278,4700,8560,3608,8844,6194,5282
,2654,9265,4529,1741,8422,3649,8583,4816,2960,62
17,1599,
4912,1937,5173,8505,12416,8642,3620,6159,2770,18
22,5313,2744,1835,8734,9290,4932,2425,6464,3185,
8526,24
83,1403,9488,4443,987,4993,3226,6277,8425,3151,8
747,10254,5272,2865,8966,1721,4339,3341,8367,318
0,8315,2
367,5197,2669,6196,9376,4758,1455,3650,8850,1012
,2860,6167,2532,5284,10312,1631,4550,3296,8804,8
533,441
4,2478,3238,10497,1513,4771,5888,3591,8969,4714,
999,3624,6278,8412,5388,2886,1890,4994,1747,4877
,8506,27
15,3267,10261,1510,5394,2536,5638,9736,4472,4524
,3342,8616,2287,5174,2426,9504,4761,1932,4832,85
87,1230
0,2507,2670,1742,4663,1837,5203,8865,12321,3713,
8775,6528,5177,2675,1500,5641,2485,1880,8547,974
4,4936,2
428,6220,6281,10372,1863,4721,9408,12353,1016,43
34,3595,6226,8479,3347,8375,5232,2866,1749,8426,
4455,97
60,4553,3652,8317,3363,8749,2509,1722,6200,9286,
4495,1938,4883,3131,6171,8852,8808,2544,6241,271
7,1776,1
892,4687,3241,8534,3632,8508,4774,2727,3186,1027
5,9260,4530,1843,3349,8433,4773,767,3228,6183,89
70,2772,
5255,10498,1838,5198,8755,1463,4445,2889,3159,10
266,1953,5409,2677,5314,9347,4341,989,3269,8537,
2399,52
05,2515,4554,1514,4762,8644,3188,8589,10753,5396
,2486,1647,4716,5642,12308,3242,8595,2785,5178,2
299,640
3,9297,5288,2510,1695,8399,4459,2490,6228,2489,1
0320,1763,4223,5259,9266,12544,8866,4287,6282,31
33,8750,

5219,2517,1940,8977,4878,9289,4503,3603,6289,862
4,2295,1487,2731,9231,4532,1867,4722,3597,6405,8
549,371
4,8379,6173,5206,2890,9536,4667,1405,4561,3353,8
428,3350,8856,4777,2786,6187,9349,4342,1521,4803
,3598,88
16,12322,1003,3249,6242,8779,2947,1954,1845,5180
,3365,8972,9268,4446,2718,3460,10277,1750,5400,2
831,198
5,9239,4695,990,4764,3163,6659,8897,10265,5209,2
897,1005,1896,4886,8318,3656,8434,3841,10262,541
0,2868,5
649,9350,4556,1516,8757,3270,8590,2776,5644,2976
,6232,5316,10376,1655,4345,8538,8648,2839,6284,2
415,105
00,1753,4778,5261,12312,3244,8550,4669,2949,3192
,8597,5221,2678,1724,8495,4507,4899,3273,6174,87
61,2733,
10504,1467,5267,2892,9600,12324,1765,4885,6290,3
408,8436,2681,5296,2759,9292,4805,9353,4461,3134
,8787,4
536,2301,2739,9298,4724,1869,4785,3354,7169,8381
,12295,8758,6215,2872,1944,4470,1406,5262,3215,8
868,927
2,4519,2950,6406,9243,5650,2734,1846,9313,4562,9
59,4889,3175,6409,8553,3250,10278,1875,5441,8898
,4346,17
54,4467,3366,8781,3165,10754,5151,2788,1522,9255
,4577,1904,4670,8407,3716,8978,2898,5320,2423,63
05,1766,
1469,4509,8839,3274,8540,10336,6720,5210,2492,10
307,1495,4699,1659,8611,3664,8598,4462,2518,3395
,6189,8
656,5665,2531,1956,8872,12417,1011,3464,6244,899
3,2463,10281,1711,5412,2533,5442,12354,9475,4564
,2953,3
369,8554,2843,5652,2521,9300,4751,4996,3842,6784
,8782,8601,2682,2792,9354,4901,1927,4711,7170,12
800,317
9,8762,2900,5383,3008,9361,4780,1849,5269,3252,8
980,4806,2913,6195,2741,9477,5222,10384,1524,452
5,9245,1
2299,1013,4890,6292,3223,10268,1870,4348,5225,32
81,8789,4469,9259,4701,3356,8764,5424,2845,1769,
9314,49
44,1850,4786,8411,3720,6190,8503,10309,1756,6219
,1470,4809,1986,4728,8900,3166,8790,3276,10282,6
410,541
6,2954,9731,4578,1960,8793,3370,8843,4902,2763,3
472,6417,8613,1499,1877,5283,8984,12328,8994,368
0,6661,2
855,10756,1891,5212,2522,1661,8803,9304,4523,268
4,6248,3424,8794,2742,5167,2302,9356,5000,895,33
97,6306,
8602,3605,8423,10289,5387,2765,12356,1931,4510,3
227,8880,3282,8845,2623,5505,2961,6197,9246,4319
,5666,3
377,8440,1006,2846,6337,2859,9362,5444,10314,151
1,4759,7172,12418,8561,4788,2427,3619,10512,1719
,4931,5
328,3372,8382,4715,4568,3181,6296,8556,5506,2745
,1770,9287,4551,1852,4892,8846,6221,3256,10400,1
777,527
0,2479,5273,9478,4905,1878,4810,3606,8851,6308,5
285,2655,9481,4817,1881,4933,8527,3609,8672,1230
7,2537,6
912,1528,4812,1823,5226,8507,12301,3187,8413,112
64,6412,5175,2914,1279,5448,2771,1988,8562,9377,
4960,25
34,6418,3239,6662,8805,10760,1933,9792,12336,101
4,4906,3297,6198,8614,3398,8617,10528,5656,2956,
1743,86
43,9261,4702,3378,8806,3844,8735,2766,5697,2861,
6227,9316,5008,1501,3229,6201,8427,8604,2524,666
5,2904,5
668,10768,1939,4818,3728,8535,3401,8564,4792,288
7,3182,10432,9856,4473,5233,3189,8967,4531,1017,
3284,62
56,8509,2773,5274,10784,1662,5199,12302,1772,491
3,2746,3243,10310,1968,5389,2962,5228,9267,4415,
4717,38
48,8414,2800,5698,2916,9364,4908,1893,4580,8618,
7176,12360,10284,5344,2867,1515,4526,1723,5286,8
645,125
45,3402,8429,6279,5639,2862,6222,9262,5672,2487,
1778,8751,9291,4934,2977,6433,6338,10371,1882,47
63,5315,
9482,12309,9025,4584,3298,6229,3621,8996,5390,25
38,1502,8904,4335,9489,4474,3610,6420,9026,3459,
8853,26
71,1992,6666,9733,4555,1407,4718,3380,6202,9000,
3288,8971,10321,6312,5761,2719,9320,1934,4723,34
88,8809,
3343,8796,4533,2787,3351,6283,10290,9378,4476,18
39,3230,8625,12420,1018,3409,6243,8912,2964,5643
,10313,
2000,5395,3622,9008,9269,4914,2511,3744,10255,18
94,5700,2891,5411,9409,4557,991,3190,6230,9028,1
0560,51
79,2429,4592,1941,4765,8539,3404,9089,3651,10373
,5289,2545,5680,9368,4775,5234,12323,3612,8435,2
978,539
7,2869,6204,9293,5276,10292,1751,4820,8854,12546
,2774,6424,3009,10263,1517,4937,5207,9380,12314,
3461,86
46,4725,6233,3245,8510,5317,2920,1897,8867,4447,
9984,4563,3193,6434,8810,6673,10374,1725,5236,25
40,9484,
12801,1955,4534,3625,6668,9090,3271,8973,6340,52
90,2679,9490,4833,9734,4347,3856,8568,3251,8620,
4558,27
77,6285,9270,4538,1780,4537,3300,7184,8857,12368
,8928,3410,6245,2748,1884,1523,5181,3384,8759,92
99,4565,
2491,6291,3776,10624,9273,5651,2789,1755,9737,43
43,1020,4779,3462,6320,9032,3246,10316,5645,1037

7,5762,
8817,1847,4938,3626,8430,3653,10322,5401,2893,53
98,9328,4834,1946,8551,3465,8649,2968,5646,2430,
6286,52
97,10296,1898,4995,8591,3355,8979,10267,6674,541
3,2870,10337,1942,4766,5508,12325,3194,8783,4879
,2899,3
520,6465,8870,5211,2778,1526,8626,12313,4945,342
5,6175,8869,2546,10279,1957,5704,2928,5889,9351,
12310,9
294,4916,6344,3633,8541,2790,5318,2493,9505,4824
,9410,5024,3275,6234,8437,12424,2519,2683,9301,4
887,176
7,4463,3135,7200,8650,12548,3412,8858,6689,5292,
2980,9492,4997,1784,5240,3466,8812,9738,4726,273
5,6436,6
466,9274,5321,10499,1905,4781,9384,12552,1007,49
40,3599,6676,8555,3654,10324,1518,5456,3628,8319
,4729,9
355,4807,3253,8383,3367,10378,5182,2951,1726,931
5,4349,1945,4787,8974,3357,6407,8599,10385,5402,
2873,62
93,1525,1900,4920,8628,3304,8818,3196,10501,6246
,5263,2548,10269,9302,4998,1871,8763,3277,8657,4
782,289
4,3254,6249,8873,5223,10283,2016,5298,8438,12326
,8899,3715,6448,2793,10338,1471,5414,2874,5213,1
2802,92
76,4836,2780,3634,8542,2494,5764,3010,9496,4946,
4471,3358,6440,8791,3657,8860,10755,5322,2984,93
05,1238
4,1757,4540,7171,12355,3371,8982,2523,5712,2901,
6307,9506,4566,9745,5443,3426,8652,4579,2915,623
6,2685,9
740,5512,10328,1851,4511,7173,9412,12329,8441,45
81,6191,3283,10380,1958,5001,5417,3473,8874,4891
,9357,4
569,3257,6411,8765,5890,2955,1906,9317,4730,1961
,4840,8603,3468,6529,8995,3416,10270,1987,6690,5
227,936
3,4948,1771,5056,3658,8981,3717,10386,6468,5300,
2535,9392,4961,1529,4789,8901,3665,8557,12432,27
43,3607,
6352,8632,1879,1948,5271,8820,12316,3312,8881,11
265,6530,5329,2794,10311,1758,5404,2876,1853,856
6,9358,
4893,2801,6294,3278,6297,8615,10502,5768,2902,97
46,12357,1015,3167,6309,8658,3399,8985,10505,521
4,2905,
5324,12330,9537,5002,3636,8442,3872,8563,2552,54
18,2847,6250,9247,4811,5520,3474,6199,8673,8766,
2303,64
72,3012,9416,5728,10401,1989,4903,7232,12804,342
8,8605,4570,2957,3379,10816,9306,4732,5472,3373,
8795,47
90,4350,3489,6680,8558,2767,5445,10285,1962,5653
,9761,12337,1908,4813,6721,3285,10340,1530,5275,
2525,53
30,9508,4671,9538,5009,3640,8660,6692,5425,2963,
9748,4894,1773,4907,8847,3904,7177,9092,12362,10
880,625
7,1969,4475,1990,5667,8997,12560,3660,8807,11266
,6298,5420,2686,6223,9479,5229,2796,1779,8876,93
65,4793,
2992,6413,3258,6252,8902,10291,1883,5304,9318,12
448,8621,4527,3718,6722,3476,8986,10388,5654,291
7,1964,
8444,9321,4703,3299,6368,8565,3968,8797,2539,565
7,2747,6310,9520,4585,1854,3666,6663,9040,3490,8
882,102
86,6696,5235,2802,13312,10315,1935,4962,3374,890
5,3721,8824,4819,2906,3843,6339,10506,9512,4582,
5287,34
32,8674,12808,1019,3611,6414,8998,2526,5345,1051
3,1895,5446,7174,12576,9379,5004,3016,3183,10757
,1663,5
426,2431,5892,9308,4814,4909,3403,6785,8619,1034
4,5277,2958,9263,4572,1912,4952,9096,7185,12816,
3286,10
402,5776,2863,5449,9483,4935,1503,5230,12480,338
1,8606,6667,5237,3024,6419,9601,5332,10293,1970,
4821,84
15,9762,12832,2918,6724,6435,10433,1774,4794,529
1,9540,12358,3260,8855,5010,11268,6203,3521,8884
,5896,2
965,1993,9027,4848,9424,4964,3289,6313,8811,3480
,6704,8664,10392,1532,6258,9602,12332,1885,4915,
3681,64
21,8647,3668,8988,10317,6300,5450,2775,9366,9369
,4910,3623,9001,3722,8906,4535,2541,3301,6231,10
404,938
1,5025,1781,3231,7178,8913,12419,9029,3492,6341,
2921,5346,11008,1994,5669,3382,8908,9322,4586,27
49,6260,
3613,10508,9271,5658,2979,5507,9544,4719,1021,38
45,6314,9056,3682,10514,5428,10758,5336,12369,19
43,4767 ,3729,9002,3405,10294,5536,2804,5391,975
2,4835,5399,12338,3191,8798,2908,5278,2547,6205,
9793,5457,10323,
1899,5012,9104,7186,12361,10297,6675,5670,2779,1
0761,1886,4559,5792,9764,12303,3672,8914,4939,66
69,3411 ,6786,8888,5238,2871,1782,8569,12608,932
9,4477,3290,6425,8627,6422,10352,1972,5452,2970,
5699,9370,12421,
9295,4593,3440,6670,3724,9009,6321,5660,2922,948
5,5026,9324,4917,3302,6437,8511,3463,8813,12340,
2966,65
32,9794,4822,2001,5057,3385,7296,9004,12311,3522
,8676,11272,6235,5509,2550,9440,1947,5293,3614,8
622,938
2,4968,2981,6728,3406,6913,10375,9735,5241,10318
,1996,9768,12422,1022,4588,3305,6342,9030,3627,1
0529,56
73,10434,5319,3846,8859,9411,4727,3247,8680,3195
,10325,5904,2791,5299,9486,4825,1785,8431,3730,6
316,857

0,10516,5348,2808,6264,5458,10762,1901,4796,8651
,3684,8814,3413,10298,6345,5432,2929,10408,9857,
4539,58
24,12672,3849,8819,4837,2542,3292,6480,8629,5510
,10379,1976,5294,8572,12364,12425,3386,6206,2750
,10339,
1519,5674,2969,5701,9739,12370,9491,4941,6426,34
96,9010,2549,5513,2924,9796,5016,9507,4478,3467,
6287,86
53,7180,12344,10326,5403,2895,9275,12315,1727,49
18,3745,7201,8688,12385,3655,8861,6247,5242,3040
,6322,9
385,4947,9776,5568,3427,8871,9330,4826,2495,6438
,6237,9493,5473,10300,1959,4594,7233,9372,12327,
8916,49
76,3359,6788,3255,10520,2002,5681,3306,9033,4838
,9303,4541,3197,6346,8821,3629,10329,5323,2781,1
907,941
3,4567,1786,4731,8543,3732,6736,8659,3688,10530,
5183,10769,6467,5460,9332,1527,5028,3414,8630,33
88,1076
4,6536,5514,2875,10436,9386,4783,1949,8929,3313,
8443,12547,2982,3850,6441,8654,5647,10381,1902,5
702,863
4,12372,3635,8633,11280,6914,5676,2930,10341,175
9,5301,2985,5415,12426,9277,4999,3011,3417,6251,
8661,10
387,5405,2795,9747,12433,4921,3524,6324,8439,346
9,8875,10416,5352,2553,5244,9741,12549,9858,4596
,7188,1
2317,3475,9034,2903,5325,2972,6295,9497,4942,949
4,5302,3279,6353,8930,12331,2782,6428,2877,9742,
5763,10
382,2017,4841,7424,9393,12386,3746,9091,4922,679
2,3630,10770,9509,4828,5682,3857,8862,4542,9604,
5058,35
04,6238,8975,6348,5406,10561,1909,5705,9307,1280
3,1963,5032,3429,6442,9041,3259,10271,2018,6544,
5419,98
00,4571,9985,4949,3308,9012,3736,10440,6752,5474
,3013,9414,4963,2004,4733,8920,3696,7202,9120,12
376,103
30,3659,6496,1950,1788,5331,8983,12428,3852,8559
,11296,6469,5521,2986,6677,10785,9388,5305,2932,
1965,90
93,9336,5003,2554,6299,3777,6354,8822,10532,5516
,10562,5464,9417,12318,8877,3198,6449,3314,9036,
10772,5
706,2797,5765,12434,9552,4583,3637,8825,3470,890
3,2993,5713,3014,6691,9278,4791,5655,3418,6444,8
445,352
8,8883,10503,6253,5360,2803,9498,13313,10389,199
1,4842,7192,12359,3430,9016,4924,2907,3477,6328,
10342,9
359,4849,5326,3375,9094,12550,4950,3641,6678,887
8,2988,5215,10345,1910,5447,7204,9319,12553,9394
,4953,6
681,3316,10544,1855,5684,2878,5920,9510,4600,930
9,4895,3667,6259,8932,14336,5522,2959,9860,4351,
1971,50
60,9042,3261,7175,8567,12449,3638,10536,6311,547
6,9418,5005,1531,5427,12864,3748,8636,11267,6369
,5421,2
919,6470,9808,5537,10403,1913,4815,8662,9539,123
33,2687,6450,3433,6916,8675,10332,2008,5333,9608
,12388,
3778,8607,4573,11269,6301,3661,8677,10287,5688,2
936,1775,9097,9513,5011,3287,6800,8987,3858,6473
,8665,1
0507,5952,2527,6254,9986,12928,1966,3719,6261,88
26,3420,8936,10625,6356,5708,2994,13314,10786,93
23,4734 ,3491,9044,3478,9152,4844,2798,3536,6315,
10564,9396,5040,5306,3752,7297,9057,12339,8885,3
873,6920,3017,5
766,10448,2020,5524,7234,12436,9367,4965,2556,34
34,10626,9425,5347,2909,6016,9500,4587,4795,3662
,6474,8
989,3481,10390,5714,10393,5538,9864,12334,1995,4
850,7680,12363,3642,10405,5422,2805,5769,9310,49
54,9420 ,5891,12554,3860,9098,6370,5480,3018,669
3,9514,5659,10346,1914,4574,8907,7179,9616,12561
,10295,6682,653
1,10568,1533,5064,5231,9824,12805,3669,8999,4479
,11328,6452,3644,6360,8666,5451,2967,1973,8828,1
2392,95
68,5006,3291,6560,8886,3383,6415,8446,10776,1997
,6423,5334,9541,12450,9749,4911,3780,6302,3670,8
909,108
17,6481,5429,2923,9371,9426,5072,3673,6694,8767,
3723,9105,12341,2910,3493,6816,10788,9521,4966,2
024,386
4,7208,8990,12481,3874,9003,11273,6262,5308,2806
,13316,10353,1916,5569,3683,8571,9763,5013,2996,
6476,36
74,6723,10394,9516,5337,10319,5528,9325,12440,10
23,3482,6684,8889,3303,10509,5729,10348,5716,723
6,12365 ,9400,4823,3760,8623,3725,10818,5671,302
5,5770,9750,4589,5349,12452,3320,6533,8799,10464
,5279,2971,6317,
9753,5540,10406,1974,4969,8681,7298,13056,3441,1
0759,6265,5430,3020,10792,9331,4797,5661,12556,3
262,905
8,5027,6697,3436,6343,8915,5893,10435,1887,5730,
8678,12562,9383,12806,3726,6928,6323,10510,1783,
5777,28
09,5453,9441,12342,9542,4852,11270,6372,3731,910
0,6482,5239,2925,9522,4956,9988,4595,3407,6456,8
910,355
2,7187,9005,12371,10881,6848,9373,12345,2032,482
7,3387,7181,8668,12809,3293,9048,11281,6534,5720
,3000,6
318,9872,9545,5459,3442,9031,9326,4919,2543,6698
,3685,6725,10763,9333,5338,10515,1534,7216,9428,
12400,8
917,5018,3494,6537,3497,10820,5488,10531,5772,35
23,8890,9387,4970,3686,6427,9106,3615,10299,5350

,2751,5511,9992,5014,2003,8944,3307,6266,9060,3484,10409,5433,10800,6592,5570,13320,10354,1977,4598,3415,9011,3444,10517,6497,5662,2983,10396,9546,5029,5454,12423,3847,9006,12366,3026,3389,6705,8631,5353,10327,1787,5675,9121,12577,7182,12482,11274,6347,5894,2931,10437,1998,5295,2810,5243,9442,12373,9765,4839,6207,3294,6484,8682,10356,5778,2551,9754,12564,9603,4856,3498,6538,8815,7240,12810,10410,5732,2973,5461,9524,12346,9432,4977,3525,7425,12456,3309,8863,6671,5897,2926,6726,9632,4590,9487,5340,3631,6700,8931,9495,12427,2783,6325,6439,9374,5434,10301,1978,4798,7189,9553,12387,3905,9108,5017,11282,6429,3876,10771,9766 ,5544,3784,8655,4597,9888,4972,3906,6376,9035,3733,6268,10765,5515,10882,1903,9334,12374,2005,4943,3880,6349,8573,3851,10521,5793,10518,6326,5703,9548,9795,5088,3689,8689,3676,10766,6787,5475,3041,10417,9756 ,4543,2006,9122,3505,7300,9013,12348,10533,3792,6706,5407,10628,1951,5303,8918,12568,3888,9153,11392,6430,5354,2933,6729,10331,9605,5245,2987,5677,12377,9389,4829,3042,3908,6443,9064,10824,5780,11009,5736,9337,12578,12817,3419,6498,3969,8684,10438,5462,3028,5436,9769,12812,9415,4923,7203,12484,3315,8823,2974 ,5361,2812,6355,10000,5030,9395,5898,3734,6545,8921,7426,12429,10412,6329,5683,2989,9444,13328,10360,2019,4978,7194,9554,12389,3526,8892,5033,6540,3390,6488,10441,9528,5059,5465,3747,8635,12435,9920,4843,3690,6730,8933,6789,5572,10576,1789,5517,7681,9606,12464,9390,4601,3970,6737,3853,10302,1980,6679,5523,9770,4951,9797,5020,3448,6384,9037,3500,10522,14337,5327,3015,9609,4830,1911,4925,9112,3737,7248,8574,12430,3808,10383,11276,6350,5794,9499,2009,5678,12818,3639,9014,11297,6239,5905,2934,6471,10343,9338,5552,10418,2021,9043,9664,12609,2879,6708,3912,6944,8922,10534,5477,10333,5307,9569,12319,3697,8690,11329,6546,3310,9072,10884,5356,2995,5784,12488,9777,5061,3431,8934,3529,6500,8637,10442,5744,2555,6451,9419,12378,5707,3471,6445,8663,3859,8827,10832,6561,5900,2937,9279,13344,10563,9556,5034,7205,12833,3663,9124,4980,3032,3750,6357,10632,9610,4602,5825,3506,7193,8879,12580,12610,3749,6712,2799,5246,10537,2010,5362 ,7190,9743,12820,9798,4845,6976,3421,11010,9772,5685,2990,5518,9397,5041,9511,5062,3317,6732,9095,7304,14338,5466,10347,5576,9501,12551,1967,4851,3530,7428,9017,12437,3738,10420,6330,5478,9448,4955,9340,5525 ,12390,3692,8692,11284,6790,5423,3044,6548,9421,5689,10391,1915,5036,9038,7432,9398,12393,10449,6371,3435,7040,10524,2022,5364,9859,12592,3199,8937,4926,11520,6738,3263,6562,9018,10888,5715,3019,1790,8924,9778,5007,3854,6446,8638,3479,6793,9154,10334,5309,10444,6915,5686,9502,12584,9801,3508,6504,3698,9128,10538,6683,5796,2938,13315,10640,9515,4967,3643,8667,3537,9045,12451,2557,3753,6255,10848,9570,4735,5481 ,3318,7206,9059,12380,3779,8829,11298,6475,5826,2997,13317,10592,1535,5709,7682,12335,9427,4984,3021,3422,6358,10565,9617,5335,10773,5906,9401,12555,4575,3671,6453,9099,3740,10395,5767,10450,5468,7264,9612,12673,9560,5042,7235,12834,3862,10545,5539,3048,5526,9802,4846,9861,5584,12612,3532,6332,8679,14340,5800,2940,6593,9809,5921,10787,2012,5065,8887,7209,9751,12496,3321,10540,6361,6552,10349,9456,4604,5482,12674,3754,8938,4957,11288,6753,3645,6740,9020,5710,10424,2025,5529,8945,12438,9422,12441,3483,6695,3875,6794,9046,10774,1975,6373,5690,9311,12453,9543,4853,11300,6303,3861,9049,10777,6564,5908,2998,9780,10016,5066,3781,6454,8696,3437,7312,8991,12394,10355,3512,6685,9618,12343,2026,3700,7196,8447,12616,3761,9156,11271,6917,5717,2911,6754,13376,10407,9572,5692,3446,9101,9523,5015,2807,6801,3495,6477,10465,9517,5339,10566,5431,7237,9633,12824,8911,3538,6263,3865,10546,5828,11012,5718,7210,12865,9429,4971,3322,8669 ,3443,10397,5721,3056,5771,9784,4958,5541,12836,3553,6744,9107,3646,10896,5912,10569,6483,5922,10048,13321,10350,1917,4854,7684,12401,3485,10357,6362,5731,2558,10452,9804,5044,5722,12442,3675,8830,12367,6512,3438,6796,8940,5530,10411,1999,5351,9136,12557,7217,9402,12396,11393,6374,6535,11016,1918,5808,3027,5773,9862,12866,9620,5073,11330,6457,3540,6594,9061,14344,5368,3001,9443,12512,10112,5019,3727,6686,8683 ,3972,7242,8891,12454,10570,6478,5489,9810,12807,9634,5068,3877,7440,12840,3687,8946,11776,6377,5310,2811,6699,9518,9865,5484,3756,6918,9050,9987,12483,3022,6319,3782,6267,10466,9576,5774,10789,2033,7328,97 55,12558,3501,8670,4857,11275,6802,3866,10778,13318,10627,5779,3324,9160,9327,4973,3445,6756,8575,3677, 6485,10548,5455,10456,5600,9547,12929,1979,3920,6921,9102,3762,10656,5435,10511,6364,5341,13329,10519,9430,5048,3785,9007,3704,10398,6458,5490,3002,10577,9525,4591,5733,12811,3554,7688,9168,12563,10790,3878 ,6568,5542,10912,2028,5545,9062,12868,7456,12579,11304,6539,5571,2927,10358,9404,5734,3029,5663,12347,9665,4799,6817,3499,6727,9109,10572,5355,10819,5532,9433,12457,9624,12848,3976,6499,7696,12402,10780,5463,3030,5492,9825,12565,9812,5031,11332,7360,12444,3486,8919,6431,5895,2975,6327,9767,5074,9866,5437,3295,6378,8685,7712,9445,12375,10629,6269,6701,9375,13322,10413,2034,4979,7238,9636,12485,3735,9065,4858,11394,6804,3764,6760,10361,9526,5342,3907,8893,12404,9757,4599,3691,6486,9123,3544,6460,10793,5546,10439 ,1981,7212,9989,12458,9826,5021,3527,6385,3868,11024,5573,10419,6922,5357,9873,9549,4974,3881,6707,8948, 3786,10468,14352,5679,3043,10578,9335,4831,2007,9052,3793,7299,8691,12349,3909,10552,11283,6489,5953,13330,10944,1982,5924,12819,3788,8923,11277,6596,5832,2813,6541,10630,9816,5954,10414,5781,12813,9555,12930,3004,3936,6547,9015,10794,5928,10821,5899,9434,12569,7249,12566,11312,6351,3882,9114,10633,5737,2935 ,5724,9584,12814,9868,5089,7218,12465,3678,6818,9066,10523,5553,3033,6702,9446,12581,9607,5840,3984,6929,9110,7241,12676,10362,6576,5936,3045,9529,13440,10688,9666,4981,7183,12379,3794,8694,5035,6501,3768,6331,10593,9758,5090,5956,3449,7488,9125,12872,9550,13057,3507,6380,6808,5467,10801,2011,6017,7301,9449, 12486,9771,5076,11278,6768,3889,10443,9990,6731,5363,9391,5022,9339,4860,3391,6924,8935,3693,7220,10303 ,14368,5782,10580,9874,12460,2036,5037,3884,7191,8952,12408,3556,10634,11336,6849,5574,9828,9557,5438,12489,3502,9073,11521,6270,5795,3034,6386,10767,9993,5738,10822,2023,8686,7302,9436,12624,10796,6709,3910,6542,10421,6018,10535,5901,9530,12350,3739,8894,11285,6490,3560,6600,9113,10525,5496,2991,5548,12570, 9640,5063,3311,8693,3450,6502,9068,10472,5785,10364,6549,5856,9611,12431,13324,3531,6447,3694,9039,10445,6713,5687,2939,9889,13345,10422,9799,4982,7552,12391,3699,9184,12466,3046,3509,6388,10883,9571,4927,5960,3452,7244,8639,12582,7305,12381,11396,6739,5745,2814,13377,10802,2040,5358,7250,9503,12932,9399,5043,6333,3890,6710,10526,9450,5479,10825,5577,9341,12490,9773,4603,3533,6820,8925,7224,14339,5519,10539,5907,7195,9876,12880,9832,4985,3568,7265,12611,3741,10594,6505,5711,9558,5080,9532,5798,12680,3751,6850, 9019,11299,14341,5554,2559,6733,9457,5797,10451,1791,4847,9126,7207,9994,12585,3796,10641,6359,11522,6930,10425,9779,5469,13058,3913,9074,5038,11290,6791,3701,6492,9129,10636,5365,10584,2013,9155,9561,12395 ,3423,6563,3539,6550,8939,10826,5578,10885,6608,5786,9668,12468,9613,11777,6824,3510,8697,10833,6945,5740,3036,13332,10775,9619,5092,3809,9047,3323,7427,9116,12439,10480,3534,6506,9423,12497,5483,3514,7252, 8926,12572,3513,9021,11344,6734,5247,3049,6553,13568,10446,9890,5311,7306,12936,9774,5067,2999,3541,6714,10335,10001,5902,10567,5527,7313,9648,12382,12492,3319,6932,3755,10804,5556,11040,5746,7429,9573,12586,9403,4986,7197,12688,3914,10642,5691,3050,5585,9452,4605,9880,5801,12896,3810,6741,9157,7211,14400,5366,10596,6716,5827,9840,13346,10547,2027,5045,7266,9803,12640,3971,10541,6363,6455,10657,9996,5069,5470 ,12613,3742,9130,12821,11301,6852,3855,6742,9076,5719,10453,2014,5788,8698,12443,7683,9921,12498,11289, 6745,3921,6795,10808,2029,6565,5910,9342,12593,9458,5096,11286,6936,3892,6946,8941,11072,14345,5580,2941,9781,9614,4988,3800,6755,9137,4000,7256,9158,12835,10828,11400,6746,5369,9562,12588,9672,3863,7308,12397,3439,8947,11524,6554,5802,3023,6375,13336,10426,9574,5693,3973,9051,9621,12472,2942,6832,3702,6797, 10886,9519,5531,10644,5923,7198,9785,12822,3757,9132,11528,6392,3916,10467,13348,11136,5909,7314,12825, 9460,5046,3705,9022,3783,6513,10834,5829,10658,5485,9811,12403,5560,3325,6334,9103,3763,10542,5748,10889,6508,5809,9405,13319,11011,9782,4959,7239,12455,3896,10600,6798,5494,3057,10779,9892,4855,5543,12513, 3974,7430,9063,12614,14342,3758,6803,5586,10351,1983,5913,8831,12594,7433,9577,13060,11302,6479,6624,10 571,9922,5370,3003,5491, 12445,9805,5104,11778,6459,3812,6365,9080, 14353,560 1, 10454,5694,9431, 12944, 1000 2,12617,3922,6514,3447,7329,8671,12398,10549,6757,5533,9863,12405,9564,4606,11360,7744,12500,3516,9138,
11331,6566,5723,3052,6569,9635,9622,5486,3542,6595,8942,7213,9680,12459,10428,6758,3555,6687,9896,13441 ,10689,2035,7268,10017,13064,3487,9161,5075,11305,6379,3557,6556,10457,13378,10648,5588,3977,8700,9578,
5049,3867,6487,9053,3545,6516,10849,5775,10836,6020,7808,9806,12618,9625,3706,6919,3816,10791,5925,1089
0,6461,5735,13824,10469,9786,4859,3924,8949,4032,10399,14346,5804,3058,10660,10004,5070,5830,12514,3937 ,7219,9162,12837,3765,10550,11408,6366,5549,13323,10781,2037,5914,12826,7316,12675,11292,6570,5372,3005 ,11013,9813,5493,10850,5725,12596,9788,12504,6597,3869,6381,9111,10897,5968,10573,5810,9435,12704,7214,
9527,12559,11333,6703,7243,12567,10359,5833,3031,5752,9924,12446,9814,5050,11306,7434,12625,3978,6977,9
067,14354,5602,3006,6948,9817,12838,9867,5926,3787,6856,9054,7441,9637,12960,10840,6978,6805,10008,1335
2,10579,10018,4975,7685,12406,3879,8950,5077,11780,6952,3546,6923,10458,9827,5547,3708,7272,9140,12620,
9818,12867,3766,6761,3326,6748,10608,6024,10892,1919,7330,9626,12828,9447,5078,11313,6577,3789,10470,13
380,10631,6864,5534,9904,9869,5023,3647,6960,9169,3985,7221,10553,14464,5343,10690,9464,12677,2030,3870 ,7361,9115,12461,3883,10782,11338,6980,5783,13442,10574,9585,5812,12409,3451,9164,11536,6491,5955,3035,
7041,10473,9406,5739,10795,5592,12841,7320,9580,12487,11014,3769,6387,10415,5575,10363,5916,9870,13072,
7245,12467,11424,6806,3503,8953,10898,5929,3060,5834,12516,9875,5091,7332,12626,3679,6598,9069,10852,58
41,10581,6462,5957,9551,12600,9696,13331,3561,6819,7936,12992,11017,6762,5836,3047,9531,13325,10460,943
7,4861,7436,12678,3938,9144,12462,7042,3795,6925,10554,9586,5052,5984,3558,7442,8687,12842,7686,9829,12
869,11784,6520,6572,13360,10664,2038,5930,7222,9638,12681,9641,4983,11552,6809,3980,6880,10635,9667,143
48,5726,9830,12571,9759,5081,3790,6711,8895,3885,7251,10913,14369,6032,10823,7225,9451,12410,9628,5093,
3548,7689,12736,3928,10595,11792,6984,5842,9559,9588,5816,12641,3911,6769,9127,11456,14401,5497,3064,63
82,10527,9991,5555,10423,2041,9170,7280,9533,12849,3797,10474,6503,11808,6601,10365,13326,10797,5937,12
491,3770,9075,11334,6543,3986,6931,8954,10900,5439,10856,5741,12351,9438,12628,3824,3940,6735,8695,1058
2,5932,10556,6822,5604,9642,12682,13384,11308,6578,3891,9117,10481,6821,5550,2815,9669,13569,11018,9453 ,5082,7303,12815,3886,7246,9070,12870,10803,3511,6493,9775,12844,5958,4001,7457,8927,12469,7362,12583,1
1395,6389,5787,3037,13333,10585,10049,5608,7253,12573,10020,5039,6602,3562,6810,10692,9928,5359,10637,5
498,7444,10050,12520,9877,12412,3695,6764,7690,14356,5579,10643,5742,7226,10024,12493,9995,4987,11345,7
336,12470,3743,10447,6507,5747,9833,5094,9820,5557,12931,3811,6271,9185,7307,11314,14592,5500,10914,633
5,9649,13444,10798,2042,4862,7267,9936,12850,3988,11025,6926,11337,6551,10672,10032,5938,12574,3535,907
7,12873,11279,6580,3915,6770,9131,10597,5581,10427,2015,9186,7254,10052,12587,11584,6715,3453,6609,1047
6,5616,10904,6825,5789,9563,12642,10113,11397,6390,3569,6851,9172,10864,14370,5799,3051,13347,10827,945
9,4607,4002,9118,3893,7228,8956,12499,11020,11316,6494,5844,9878,12689,13570,3798,7448,12473,4033,9133,
11287,6743,5961,3038,6812,13338,10945,9670,5749,7257,12684,9534,12632,3053,3944,6934,10366,9891,5471,10
482,5587,7458,9834,12874,7697,12933,11398,6604,3564,10805,13825,10638,5558,7692,10114,12881,9997,5084,7
364,12823,3703,6393,10586,5857,10696,5371,9592,12528,9644,5582,3801,6826,9159,7309,14360,5562,10598,671
7,5561,9881,13392,10645,9952,5097,7269,12494,3772,10543,6555,6947,10809,9783,5047,5589,12383,3515,7315,
9078,12615,11648,14372,3813,6933,5367,10484,2044,5803,9023,12852,7344,10056,13088,11340,6853,11401,650
9,10835,9841,6584,5962,12690,9454,5098,11346,6772,3917,6833,9139,10429,14343,5858,10806,9575,9673,12644 ,3992,6518,3454,7310,8699,12595,10916,11320,6567,6019,9615,12589,10003,11291,7698,12705,3894,9081,11361 ,6610,5790,3007,6937,13349,10601,9807,5903,3923,9176,7489,9894,12501,10946,6394,3802,6515,9650,13337,10
829,5969,7199,9893,12856,3570,8943,11303,6625,3952,6718,10455,13334,11026,5940,7368,13120,9565,4989,381
4,9134,3517,6557,10887,5848,10588,6048,7258,9461,12876,13448,3543,6747,3707,10659,5911,10646,6510,5487, 9674,13572,10704,9882,5071,7713,12474,4004,1092
0,14465,6021,3059,11041,9836,4990,5750,12934,375
9,7460,9
188,12692,7490,14402,11523,6612,5805,13576,1060
2,2031,5964,12515,7700,9579,13184,11348,6799,704
4,10830,
9343,5753,10649,5831,12882,9407,12706,11402,694
9,3975,6759,9163,14848,5373,10810,5811,9998,1259
0,7431,9
623,12937,11409,6828,3897,7317,13059,11028,6854,
5944,9652,12648,9842,5105,11525,7270,12827,3572,
6573,90
82,11293,14347,6022,3061,6938,9787,9681,5806,391
8,6396,8701,7273,9897,12399,10837,6517,11307,674
9,9462,
13350,10812,9923,7472,12619,3817,9141,5051,1136
2,6992,3898,6834,10459,13826,10551,5860,3804,916
5,9566,1
2502,3518,6857,4034,6776,10948,5970,10838,5495,7
464,9815,12597,9884,11779,6626,4008,10841,13408,
10891,6
950,5564,13379,10661,10006,5100,3547,9192,3925,7
331,11032,14376,5590,11042,9676,12476,5603,3939,
7260,90
84,12737,3709,10851,11352,6571,5535,13353,10842,
9465,5605,12505,7215,12696,11404,7048,6025,2943,
10650,9
898,5915,10471,5593,12897,7435,9789,12884,14404,
3979,6558,10928,5754,10893,5864,9627,12839,7553,
10019,1
2938,11294,6367,7714,12517,10488,5972,3054,6080,
12447,10005,5106,11410,7492,12708,3559,6807,914
2,14466,
5985,10609,6836,5813,9925,12598,9581,13456,3767,
6979,7376,9656,12829,10430,6763,6616,9844,13340,
10604,9
905,5053,7554,13061,3818,9055,12898,11335,6599,3
900,6940,10894,9590,5917,3825,7318,8951,12945,73
21,9639 ,12621,11526,6953,3926,6858,13381,10899,
2039,7333,9682,12407,10009,5079,11529,6865,3929,
6981,10575,1335
4,10720,14355,6026,9466,9587,5054,3576,6860,9200
,3871,7274,10555,14349,5835,10461,7223,9697,1288
8,9790,
3327,7496,12627,4036,10610,11425,7008,5927,1382
8,10853,9629,5594,12506,3981,8702,11840,14384,57
56,3062,
6954,10662,9819,5814,10665,5374,12656,7704,9582,
12940,3791,10691,11309,6750,10854,13361,10783,5
837,125
18,7745,12679,11364,7056,3549,9171,10475,5695,10
652,6033,12601,9684,12738,7716,3987,6866,9145,10
583,591
8,10612,6840,5931,9871,12830,10116,13386,11904,6
521,7281,12622,11015,6579,5499,3065,10021,13584,
10557,9
831,5083,7322,12521,3710,7247,8955,12843,14350,3
820,6961,9900,13062,5817,4016,7437,9166,12463,72
76,9926 ,12411,11315,6463,6765,13472,10462,9645,
5551,7746,12946,10010,5108,11412,6956,3941,6628,
10666,9468,1440
8,5727,7392,9589,12900,9821,12629,3563,6574,3771
,7334,10693,14593,5609,10477,7687,10064,13065,99
06,5095 ,11310,7720,12508,3826,10799,11339,6982,
5986,9929,9848,5843,12602,3930,6811,9146,7363,11
530,14357,5606,
11073,6632,9698,13832,11044,2043,7438,10022,127
12,3550,10952,6383,11537,6522,11074,13600,10901,
6028,12
683,4040,9071,11781,6603,3455,6766,9173,11048,58
38,11019,5933,12961,7809,9643,12871,11368,3982,6
771,108
57,5596,10844,6581,5976,10120,12643,13840,11426,
6524,3887,9174,10673,14468,5959,3066,13504,1096
0,9630,5
112,7691,12575,4048,7443,9119,12471,11056,11317,
6962,5845,9439,12522,13856,3942,7748,12413,7459,
12845,1
1457,6605,5818,3039,13382,11076,9879,6034,7227,1
2948,9908,12904,6640,3989,6813,10587,10051,5872,
11137,5
988,7337,9835,12630,7728,9688,12604,11416,6823,7
282,14371,13356,10483,5939,7445,9671,12529,1001
2,4863,1
1341,7324,13066,3799,6868,10902,14594,5934,1002
5,12851,9930,5559,3565,6985,9187,7255,11428,1436
2,6049,1
0694,6773,9937,13443,10558,10053,5085,7365,1263
3,3945,10915,6495,12032,6611,10858,9932,5610,127
40,3773,
7284,8957,12685,11532,14849,4003,6582,11138,574
3,11021,2045,9148,7338,10080,12691,11538,6881,11
782,639
5,10616,13393,10668,6606,5791,12495,10026,11318,
6586,3828,6585,9079,10905,14416,5859,10976,1336
2,9822,1
2962,3932,3571,7229,9177,12846,10807,11347,6613,
6036,10128,13073,13385,11321,7699,12720,3803,91
89,1178
5,6391,5583,3068,6827,13327,11080,9938,5963,7693
,12645,7810,9912,12475,10865,3895,6986,9593,1363
2,10478 ,5501,7449,9651,12524,7446,12952,11376,6
882,3994,10599,13445,10697,5617,7694,12912,1003
3,5099,7345,1287
5,3946,7043,10639,6050,11027,5941,7461,9535,1306
8,9837,13364,3990,6814,7556,14373,5846,10831,692
7,6081,
10028,13335,10918,9700,5086,7259,12993,3574,106
74,14361,6993,10917,9646,5101,5992,12414,4005,77
52,9178,
12530,7937,11399,14358,11342,6964,13446,10589,2
046,5612,12853,7366,10054,12686,11553,6872,1145
8,7072,1
0485,9883,14472,5751,12634,9704,12744,11349,693
5,3815,6511,9135,10698,14596,5849,10906,9455,734
0,9594,1

2646,11540,7045,3832,7288,12693,10860,11786,6774,5820,9675,12591,9838,11322,7369,12857,3953,6829,9083,11432,14600,5563,3055,6988,13696,10603,9843,5861,3566,9190,7504,9653,12532,10367,6777,11403,6855,9596,13388,10431,13449,7230,12883,3774,8958,11363,6397,3993,6835,11022,13394,10647,5965,7450,12477,10034,12854,3573,3948,6968,10676,6040,10866,5502,7311,9677,12964,13368,11350,7046,3919,10811,13339,10705,6830,5942,9712,13409,10921,9885,5055,7271,12649,4064,7346,10486,14374,5971,10947,9895,12994,5850,3519,7462,8703 ,12877,7261,14850,11324,6884,5618,13351,10590,9940,6000,12503,7812,13074,11544,6994,6519,10839,10057,5862,10908,5565,12935,7370,9845,12636,11353,14432,3805,6588,14403,5591,11030,5755,9567,12707,7760,9683,12694,11554,6614,11793,7491,12752,10700,6627,6052,12968,9654,5107,11788,7560,13089,3899,6559,9180,11460,14377,5807,10489,6629,9953,9467,13571,4006,7049,7465,9678,12650,10922,6939,11405,6617,9658,13396,10813,9657,7938,12878,3954,9193,12697,11365,6778,4009,6888,10651,13450,11043,6023,4035,9143,7275,9685,12858,11411,6996,3819,7104,13457,11029,5945,7348,9463,13076,9899,11440,7009,3577,6837,10949,13573,10605,14480,5620,13341,10680,10058,5109,3927,9194,3996,7319,10868,14364,5966,10929,7377,9954,12885,13355,3806,7452,12860,3901,10614,11406,6941,5865,13410,10663,10115,5946,12507,7816,12599,11794,14405,5852,3063,10706,9886,5566,11033,6082,12996,7262,9999,12886,7372,14378,11585,7050,10490,13827,10611,6056,12889,7466,10065,12939,11295,6859,7568,12709,10721,5595,10814,5973,13080,10036,13090,11464,7776,4037,6951,9085,14852,5987,10653,6618,5757,9944,12899,10144,13400,11354,6780,7520,12890,10843,6838,6398,10007,13452,10606,9583,4991,7493,12698,4010,7701,9167,12519,11809,14385,3956,6861,10117,6027,3578,7323,9086,12976,7378,9846,12941,11556,6719,11586,7057,13342,10708,9901,7473,12536,10060,5102,11796,6942,3821,6955,10895,13458,11140,14410,5607,9849,9927,12657,4017,6523,4038,7715,11045,14608,5815,10855,7468,9469,12478,9907,11527,7277 ,12652,3827,10924,11413,6841,5866,13383,10950,10040,5948,12942,3931,9201,7352,11366,14496,5873,10669,6575,10118,13574,11034,5974,7702,9902,12947,4012,10492,11369,6751,10613,13577,10845,5977,12623,7705,12768,11568,6633,3902,9147,11088,5624,10930,5919,12603,7283,9956,12509,15360,3983,7010,10953,5375,10872,6867,6084,10066,12658,9591,13473,11560,6630,7335,12901,10722,14856,6029,3067,13888,11046,9660,5110,7393,12710,3943,7494,9196,12713,14624,11427,7052,5839,9686,12739,13357,3711,7474,12902,7940,9699,12831,11356,6862,6957,13412,10667,9631,5597,7325,12523,9701,12700,11311,6620,3960,7000,11144,10121,14864,6035,7824,10011,12631,7497,9689,12660,11531,6983,3551,7278,14528,13952,10654,7285,9850,13063,9960,5113,11649,7380,12605,4018,6869,10463,11810,14880,5758,10068,10176,5868,3822,6842,9202,7339,11588,14406,6064,10903,7058,10081,13363,10932,9909,7944,12510,4041,11075,6896,11472,7012,10859,13460,10712,5989,12714,3580,9149,11650,14380,3933,6963,10695,5611,11036,5819,12741,7498,10013,12525,11414,11417,6958,11049,13358,10954,6583,5874,12847,13387,11429,7073,3829,9175,10961,14467,5978,11077,13578,10122,13121,7394,4042,7717,9150,13092,10956,11370,6634,5598,9931,13000,13585,11319,7706,13122,7555,12949,11592,6767,6088,3069,13829,11104,10023,5503,7476,13096,7384,9690,13067,14417,3991,6815,9852,13416,11050,6030,7584,9910,12905,7439,9470,12892,11800,6883,7447,14386,13474,10846,5935,7326,12721,9933,5114,11841,7505,13008,3947,7060,11152,1 4409,6096,7718,9791,13104,10 129,13365,3934,6607,7840,11812,14351,5990,10962,6987,100 14, 13505, 10936, 10027,5087,7286,13124,3830,10617,14656,11377,6525,10675,9595,6037,12635,4020,7500,9179,13185,7747,11418,14469,11343,6641,13464,11057,2047,7708,9913,12531,11533,7074,11372,6965,10559,13389,10861,14388,5847,12950,9647,11842,6870,4049,7105,9204,11052,14359,5613,10724,13476,7557,9823,12742,11488,3995,7341,12606,10670,11430,7016,5993,9705,12963,14080,11783,7289,12906,4044,9191,11816,14470,5821,3070,6636,13580,11078,10082,6051,7721,13186,7367,9939,13069,10907,11459,6775,9702,13586,10728,13830,7952,12664,7347,12716,11534,6873,3833,10479,13366,10618,5876,7396,12953,10124,13024,7506,3949,6844,10699,5980,10862,561

9,7480,9934,12855,10029,13395,11905,6587,7872,14720,13369,10867,6885,5851,9692,13833,10677,10072,5116,7558,13128,4024,7342,10620,14412,14473,10055,12913,5943,3567,7722,9208,12526,7749,11787,14418,11539,6989,13424,11058,9941,6042,12647,7561,12745,11844,7064,11555,6526,10701,9914,14392,5994,12687,7451,10130,13075,11323,14363,3775,6966,10736,14433,6038,10909,9968,7290,10084,12879,11433,6995,11824,7616,12966,10919,11378,6874,5622,12722,10035,11541,7521,12965,4007,6642,8959,11420,14375,6053,10964,7024,13447,10030,13390,4050,7729,9655,12637,11081,6886,11351,6589,10145,13601,10869,13506,7371,12533,3955,9181,11461,6615,3834,6779,10591,13397,10707,5863,7231,12746,7508,9706,12954,11380,3575,7076,13588,10678,5880,7562,9839,12908,13834,11434,6831,3997,10977,13370,10491,14595,6001,13480,10702,9887,5103,7695,12651,3950,7750,10682,14420,5614,10681,7724,9955,12415,13451,3807,7349,12479,7463,14474,11325,7047,5822,13411,10709,10132,6041,13070,7453,12695,11795,14481,6969,10487,9679,5621,10923,5996,12724,7400,10059,12914,7292,11789,14597,11906,6644,14365,13398,11082,5967,12859,7373,9597,12753,11545,6990,11542,7350,12969,10978,14379,6112,12534,9713,12995,11790,7811,4065,6889,9195,11441,14434,5567,11139,6970,10146,10037,13372,11557,6876,7730,12638,10910,6590,11652,7106,9942,13592,11023,10177,7454,12887,3957,7753,9182,12956,11355,14851,4011,7080,13401,11089,5853,4066,9197,7467,10088,13078,11848,6619,12033,6997,13602,11060,13841,7522,12748,9708,11462,7011,4052,6781,10968,13836,11168,14424,5947,13508,9847,12537,3998,3836,7379,11031,14476,6054,10607,7569,9945,12970,13453,11436,7353,12861,4013,11141,11384,7051,6002,13413,10870,9916,6057,12699,7564,13091,7512,11465,14366,6083,10925,9659,13459,11084,5867,7754,9957,13077,7813,14482,11600,6631,10873,13488,10951,5625,12997,7761,12653,11326,6839,7703,12728,10493,5975,10931,6044,12916,7408,10061,12977,11546,15361,4039,6890,14407,5854,11064,6972,5949,10136,12662,9598,13454,11407,6897,7374,12711,11142,14598,6998,13842,10926,10038,5111,7263,12754,3958,7495,9151,13081,11367,14601,11442,7001,10067,13633,3903,7732,12538,7968,9946,12659,11558,6648,11357,6943,13343,10980,9714,7570,12769,10096,12862,11908,6399,4019,7108,11090,13512,10615,14497,6085,9958,7524,9661,12701,11466,7053,3579,7475,14912,13402,10684,7469,9687,12891,9851,11856,7585,12654,3961,6863,10710,11587,14381,6058,13857,10723,10148,6004,4056,9203,7381,11656,14436,5626,10655,6621,9903,13604,10725,13634,7736,12756,3823,11145,11561,7059,11035,13844,10713,5869,12943,8000,13188,12034,14976,4014,10874,6065,10984,6086,13093,7756,10119,12903,15362,11371,6782,11092,13575,11200,6892,5875,12972,10041,13461,11444,7088,7354,12998,11105,14387,5979,10933,13414,9716,12717,7814,4068,7572,9205,13082,14484,11415,7013,6060,10062,12540,13417,11473,7395,12661,8064,12893,11548,6635,6843,13616,11037,9961,5950,7762,13136,7586,10042,12978,11912,14382,4043,6898,9948,14411,6031,7470,9662,13001,7817,10178,12920,11358,7002,11468,7939,14602,13608,11146,7528,12770,10152,5115,11562,7707,13094,3962,6622,10955,11664,14609,5991,9691,10069,13475,3581,7112,7279,11872,14853,5759,11047,6527,10083,13404,10714,9853,7499,12715,4021,10876,14440,11616,7054,10934,13359,10494,6008,13192,4045,9087,7382,11589,14498,11797,6959,13579,10957,5599,7477,10123,12702,11419,11474,7120,10815,13697,11153,14389,6066 ,12511,13858,11569,7014,4072,9198,11038,14529,5870,11051,13636,7356,9703,12951,15364,3964,7617,12980,10619,11811,7061,6089,9911,13123,13520,11564,7385,12907,7576,12760,11373,14488,5628,3071,13698,10937,9962,5981,7777,12743,7764,10044,13084,14413,11448,6871,9969,13462,10671,13465,7719,13097,7818,10070,13002,11798,6637,7397,14500,13477,10847,5877,7327,13009,10073,13125,11801,7588,4022,7017,10729,15104,6090,7478,9720,13004,10015,13418,11379,6845,7709,14604,13367,11106,7075,9471,13640,10963,10180,5117,7941,13152,3935,7778,10726,14610,11431,14854,10125,6039,3831,7825,9206,13098,7501,11489,14390,11590,6900,13848,11148,9935,7287,12894,11570,7004,12036,6643,10958,13889,11053,14419,5995,13200,9693,11421,14393,4080,68
75,10716,14857,5982,11096,13860,7768,10131,13010,11920,11593,7507,12984,11079,11374,6967,5878,12665,13
425,11381,7386,12723,3582,9209,11476,14448,6068,10965,7066,13466,9854,13391,7536,7820,9964,13105,10938,
11435,7018,10160,13581,11154,13420,7398,12607,7559,12909,12040,7062,4051,10992,13890,11108,6097,7481,1
3100,7618,10085,12772,15368,4025,6646,13536,11059,6043,7710,9707,12718,9915,13478,11594,7077,7502,1447
1,13831,11054,14414,6092,13864,10679,9970,5118,7401,13126,3835,7723,11169,14625,14530,7942,10074,12955,
13507,4046,7343,12776,7291,11490,14421,11813,6887,13582,10730,9694,5881,12527,7826,12666,11802,14612,1
1651,6904,10863,10184,14858,5997,12747,7780,9599,12910,7509,11572,14394,11480,7025,14504,13953,10911,7
945,10126,12915,11680,6638,11535,7388,12725,10979,11543,14475,6072,12668,10031,11422,7482,4026,6846,92
10,11601,14435,5615,11156,7065,13835,10192,13587,11814,7592,13106,10703,6645,11936,7020,10086,13892,11
083,13603,7563,12749,3951,9183,11382,14422,4053,6991,13371,10621,5823,7841,12784,7751,10133,12957,1159
6,11843,7136,13481,10737,13872,7523,12967,13426,11804,6591,4054,11170,13589,11061,14396,6055,13468,994
3,13012,7455,3999,7351,10966,14616,6098,11201,7402,9709,13129,13399,11653,7293,12917,7725,14425,11437,6
877,6003,13509,11112,10089,5882,12639,7828,12755,7784,11385,14626,14865,9917,13428,10732,5623,7510,101
47,12726,7484,11817,14860,11463,6971,14532,13482,10871,6045,13025,7409,12539,12048,7078,11443,7946,127
50,10969,14477,5998,12730,7731,9972,12729,11492,15376,4067,7026,11602,14437,5855,10940,7081,10076,9715,
13373,11576,7107,7513,12757,10683,14483,11968,6891,13843,10981,9947,7620,12535,3837,7565,9212,12971,11
654,14512,11438,6649,13837,13954,4028,7571,10039,13130,11818,6999,11845,7068,13593,11085,13590,7375,13
026,10138,11657,6878,3959,6973,11160,13838,10622,14478,6113,13489,7842,10090,13187,11547,4057,7726,148
66,13605,11062,7953,10134,12958,13700,11386,7600,13071,4069,11091,11712,14657,6005,13403,10970,9718,60
59,7525,13137,7355,11617,14367,6114,10738,10149,13896,11120,14081,7404,13108,7832,14536,11825,7109,109
82,13510,10685,6100,13016,7792,13216,11467,14426,7755,10711,6046,10875,5884,13079,7948,9959,12655,1132
7,15392,11604,7082,14881,13484,11172,7028,6061,13189,9976,13432,11658,6650,7873,12918,10927,14628,1465
8,13513,10097,12973,7294,4058,7410,9199,13132,11791,14868,11846,6893,9710,13648,11820,7733,12921,7566,1
2999,11445,7089,11559,7110,13374,11143,9918,7514,12541,7624,10137,12979,11549,14599,4015,6899,13594,110
65,14485,6087,9717,7526,10092,13112,11496,7003,11388,7573,14438,13455,10740,7471,13190,10063,11469,773
7,12974,3963,7084,11086,11446,14441,6006,13415,10208,13490,4070,7412,11907,14640,5951,10985,6974,9663,1
3606,11066,13405,7763,13028,3838,10972,11826,7055,10686,13956,11202,6067,13138,7357,12663,7734,11550,1
4632,11849,13514,11176,5627,7844,9949,12732,15363,11563,7015,10715,13904,11093,14499,6009,12758,13635,
11618,6783,7529,12771,11107,14428,6104,10877,13704,7874,10043,12703,15365,3583,7757,12773,14383,11475,
7032,5871,10150,13193,13609,11665,7383,13083,7954,12761,11449,14603,6623,14082,11147,10098,6062,7815,1
2922,7516,10153,13032,11660,14721,11608,7090,10179,14882,13419,7587,13140,7574,9963,13248,11850,6894,1
1909,7632,14660,13492,10727,7848,13153,9721,12981,11857,7969,4060,7113,10935,11799,14544,6116,10071,10
140,13463,11504,6652,7530,14722,13521,10986,7005,9950,13596,11068,10045,7758,13085,4073,7577,10993,144
86,11470,14489,13960,11094,6091,4023,9207,7738,11359,14501,11591,6901,13406,11097,13516,7956,13194,118
28,12064,7114,10744,13610,11039,14442,6010,13003,13712,11666,14391,4074,10495,14664,5629,11204,13920,7
765,10181,13095,15424,11620,7740,12762,11149,11571,7063,6069,12924,13664,11565,7387,12982,7479,12542,1
1681,14872,6093,10959,13637,10154,13845,7876,7766,10100,13005,14913,11477,7019,9722,13467,10717,13522,
7769,12863,7819,13201,11832,7006,7589,14884,13617,11155,6120,7960,13086,7970,9965,13099,12096,15369,39
65,6902,14449,6012,7779,10161,12667,10182,13859,11852,7092,7770,14490,13612,10878,14415,13421,10988,9971,5119,7578,12985,4047,7399,11184,14605,11450,14444,10075,13496,3966,7856,12719,7821,11910,14914,11668,7121,13846,11109,10156,7416,12895,11491,14560,12160,7067,10731,13849,10939,14502,6070,12777,10046,7537,11858,14855,11682,7116,14888,13427,10994,7358,10127,13154,11566,11913,7532,13011,11098,12035,14531,5983,12774,13479,11624,7822,4081,9211,11803,14606,5879,10718,6905,13537,10087,13638,15366,7827,13196,11208,11375,7021,9855,13618,10623,14084,7503,13006,7648,13101,11595,14977,4027,13469,11150,6128,7483,12764,7389,10104,13144,15377,11478,7096,13968,11055,13641,7538,13127,9695,13422,11573,6639,7781,14859,13429,11216,14611,5630,13524,10162,13013,7590,4076,7593,11110,14916,14627,7619,9966,12986,13483,11452,7782,13202,7711,14395,11713,6847,14088,11157,10185,6099,13040,7403,13156,7580,11481,14505,11672,14896,9724,14450,6073,7511,10077,13107,7540,11873,14613,11860,7079,14492,13642,10967,7943,13102,11815,7122,11914,7485,12727,10733,11493,14423,5883,13217,9973,11423,15370,4082,7027,11684,14533,6094,11113,6906,13538,10186,13861,11574,7390,12778,10941,14452,11805,6647,13850,11171,13699,7594,12911,4029,9213,12037,14506 ,11874,7069,13620,13528,7621,7405,10135 ,12959,11921,11597,7022,13728,10996,13583,7727,13027,13591,11383,6879,4055,11100,13470,10739,14397,6074,13649,8001,10091,13204,15378,4030,7972,14867,13862,10971,7880,10078,12751,13984,11864,8002,13131,7829,14861,11603,14978,5999,13430,11063,9974,6101,7976,12669,7947,11482,14617,14614,10164,13644,11162,13891,7785,12785,7772,11632,14862,11916,7137,14513,13852,11114,6102,13218,7601,13109,11494,14629,11655,7888,11158,14724,6047,13014,7984,10193,13249,11577,15488,11714,7029 ,14427,13701,10742,7083,10139,13485,11806,7138,8004,13160,11173,14920,11598,15105,13433,10188,7515,4059,8065,9214,12780,11497,14534,11819,7124,13865,13511,12038,7411,12919,11439,7070,11387,6908,14096,10983,13491,7830,13017,9977,11922,14508,4084,7085,13540,11000,14456,6115,13650,7622,10093,12988,11876,11605,7486,14537,13624,11121,7843,12731,14016,12041,7786,13029,4071,10734,11484,14672,5885,13702,10168,13486,8066,7949,11578,14398,6076,10942,9711,13866,11161,13893,7544,13133,7596,14618,11688,7111,10741,13705 ,11116,6007,13208,7833,12670,7904,11659 ,14479,15372,13595,11087,6105,7735,9919,13110,11937,15393,11847, 7030,14439,13434,11232,14514,6117,13139,13760,11619,6975,8008,13018,10687,14630,14429,13665,7793,10151 ,12786,15425,4088,7406,13168,11551,14980,11447,7091,10194,13873,11498,7527,13030,7625,12733,11389,14538,11821,6651,13515,10973,10099,7567,12759,7955,9978,12923,11924,14928,11880,7033,13375,14659,13652,7759,9719,13220,11606,7128,11580,7846,14728,13706,11067,7602,12975,10141,11505,7845,3839,6895,11174,12042, 14633,6106,13839,10094,13894,11827,7517,15106,13868,11122,7086,9951,13493,11177,13607,7413,13191,4061, 11203,11609,14443,13597,10987,6063,7626,13113,7834,11716,14516,11661,13544,10745,13436,7788,12788,15380, 11667,7140,11095,13517,11164,14487,6011,13134, 13494,11471,14545,7531,10974,14620,6118, 11069, 13955,7295,10209,13033,15616,11938,7359,13114,14984,11822,7115,5886,13020,13874,12049,7950,12734,7575,13250,11696,14430,14540,13598,10101,13897,7604,7794,10155,13224,11621,14634,11451,7034,10210,14736,13611,7739,12763,7633,13141,11500,6653,11928,7849,14944,13666,11205,7414,13155,7875,10196,12925,11888,15394,4075,7093,11851,14688,5631,10142,9980,13523,12044,7117,7518,14661,13713,11178,14869,13497,11124,10157,7767,13195,4062,7836,10746,14491,11969,14546,13708,13656,4077,7958,11390,14641,11506,7144,13898,10989,13957, 7628,12775,11829,11662,7036,11185,13905,11206,14883,6108,12983,13847,7417,11610,14636,11720,14445,13552,10995,7850,10183,13034,15384,11622,7741,13116, 11099,11669,14520,6121,13041,13518,11567,7579,7971,13142,11833,14870,6071,11180,13407,10102,13639,15396,7957,13145,14873,11508,7094,10047,13876,11070,14112, 7877,12792,7533,13087,11859,14451,7608,13714,11151,6122,7796,12543,7857,10163,13252,11453,15367,11830, 7007,14503,13668,7542,13197,9723,13619,11940,6903,7591,14561,13613,11111,14662,13729,10105,13007,7634, 4031,7961,10879,14642,11625,15108,10200,13525,1

1970,7418,12765,7539,14493,11853,7152,13880,11128,9967,7649,13203,7742,11479,14992,12050,14665,14144,10719,14446,6013,10158,7581,11911,14453,11612,6654,14548 ,13900,11186,7771,12926,11683,11670,7534,13036,10990,11728,14507,6095,13232,13498,11944,15489,4083,12065,15112,6014,11209,7123,13958,10212,13716,15426,7636,13157,10748,11626,7097,13539,11101,14208,7823,12779,8068,12987,11854,14666,11673,13906,13730,7973,7783,10187,13042,15872,11834,6907,13614,10997,13961,7852,13146,14083,12052,7118,7878,14562,13672,11210,14885,6129,13851,7597,10106,12766,15371,4085,7962,14874,14723,7420,9725,13256,13423,11861,7541,12671,7773,14644,11836,14552,13643,11159,10165,6075,8016,13198,7858,11483,14752,11575,14607,10189,14615,13526,7881,13103,7800,11972,14494,11862,7098,14673,13621 ,11115,7650,13264,11865,14886,11915,7974,11102,11685,15008,6124,13158,10216,12056,15400,12066,7023,14454,13500,10998,7125,10108,13761,11875,7595,13205,11188,14668,11866,14915,13529,13720,8072,3967,9215,11674,14876,11495,7126,13921,13908,15428,7582,13015,11952,11917,7071,13863,11217,13962,7391,12781,13541,11512,14725,4078,13471,11163,14509,6130,13732,7831,10166,13161,15490,11633,7860,14457,13622,11212,8003,12989,13853,11454,7787,13219,7640,14889,11628,14535,6077,14085,10079,13922,7623,7964,11918,15120,14515 ,9975,13969,11001,13645,7977,13044,7882,14564,11923,7139,14674,13431,11117,6103,13148,7889,12787,8005,11599,14648,11744,15379,15040,6078,7884,10224,13019,11579,15373,11485,6909,14726,13912,11192,14510,13651,11634,7100,8032,13111,10735,14890,11877,14917,13530,9726,15408,4086,7978,13210,11686,14729,11689,7031,13680,13964,11715,7774,13162,11878,14619,11807,7129,13542,10943,13703,8080,13206,10195,11499,14458,11676,7141,13625,14784,13762,7890,10169,12790,11607,11636,7864,14689,13854,11175,7545,13221,13646,12039 ,7603,4089,11218,11581,14897,6107,13545,9979,13867,15374,7985,14539,14086,11123,10190,13487,11002,13435,7487,13031,7789,14399,11486,14676,13970,10743,6132,7980,13048,7652,11690,14730,15432,13924,11165,13653,7598,13169,11717,15617,11501,7130,14863,14089,11118,14918,6119,12782,13532,11823,14892,8006,10975,14517,14631,13626,7835,10170,12990,15381,12097,7656,13209,14621,12068,7087,13736,11976,7407,12789,7546,13164,12098,14568,11925,14460,13707,10095,7627,7790,10197,13135,12072,14541,12043,7035,13985,14518,13895,7795,13280,11881,7142,11868,7605,14979,13667,11233,7548,12735,10198,11697,15492,4090,6910,11984,14898,6136,13599,10143,13495,12080,7986,14622,13546,11125,14921,13437,11179,13869,7629,13021,4063,11234,12100,14635,13972,13928,7664,7837,11611,14690,12161,13654,11220,13628,7847,13115,15395,11507,6655,11166,13553,11004,14547,5887,13222,14090,7892,11926,14737,15618,14521,13875,11181,8009,10211,13170,15386,11718,7797,13225,14732,11582,14680,6109,13251,13657,11939,7519,7635,13035,11882,14922,14981,13764,9981,13709,15873,7606,12793,12162,14929,12045,7132,10172,14871,13715,7905,13143,7419,13212,11640,14576,11692,7630,13519,11207,7610,13022,7609,10103,13117,11929,15440,12000,7145,14542,13986,10201,13870,11831,7095,7637,14431,14097,11126,14663,13744,10213,7415,4092,7851,11071,14900,12104,15136,13669,13499,11889,8010 ,14738,11502,7146,13548,11187,13976,7906,13253,11623,11721,14692,13936,10747,14643,6123,13899,8067,11663,14637,12051,14753,14092,11129,7838,13226,15397,11855,7951,13172,11224,11942,14549,6110,12794,14017,11698,15385,8017,11941,14904,6125,10991,13438,10202,13554,15382,7988,13037,15168,11613,7037,13877,11182,13710,7896,13233,8096,13254,11509,14924,15496,13658,13768,7959,7535,10159,13043,11722,15620,11930,7119,14522,13670,8069,13147,13717,11884,7038,7798,14982,13615,11236,14740,13881,7853,10107,13228,15624,4079,8012,14563,11627,15232,10214,13556,11391,7801,13118,7879,14930,11455,14754,13907,11211,9982,7421,13199,7859,12046,14638,11671,14985,13501,15107,13878,7992,11700,14696,11890,7153,14875,13988,11130,8070 ,13159,11835,11729,7854,10749,11945,14447,6079,12927,13673,11510,15398,11971,14667,14018,11189,7099,9727,13901,15874,7908,13176,11213,11614,14550,13527,14098,8018,7543,12767,11863,14645,11932,13959,13660,15456,7612,13234,15427,12054,7148,13731,11240,13718,7638,13038,13776,11724,14524,7651,13992,11132,14785 ,6131,14113,7583,10204,13257,15401,1151

3,7653,14553,14744,8073,12796,13674,11946,7963,13149,7641,14945, 11837,14932,13902,10217,13721,7802,7912,11675,14887,12067,14986,10167,14565,13882,8020,13045,8128,1449 5,12053,7154,14756,14100,11190,8033,13258,7861,11973,14646,11629,15504,11704,14877,6133,10218,11892,15 388,11953,7101,15109,13909,11103,14946,13884,11638,7965,13207,10999,14993,11687,14669,13531,13623,1542 9,4087,11730,14455,12057,7127,14020,13910,15402,8074,13163,11514,11635,7102,13913,11248,13963,7883,131 50,13733,11745,14936,11838,14104,14675,14114,7975,10109,13046,15876,11677,7642,14554,13923,10750,7804, 13236,13914,11867,7862,7422,14704,11630,14988,6015,13722,10191,13543,15409,7885,14566,14727,10110,1400 0,11219,13965,7743,13265,8081,14649,11732,14786,13560,11193,6126,7966,13211,7979,11919,14878,12164,154 34,14670,13681,7547,13260,12069,15632,11879,7131,14569,13502,11003,14891,13676,11948,15110,7865,11214, 14511,11974,14459,13966,10225,15520,11693,7599,13049,14994,12058,7156,13971,11516,7775,13165,11637,149 48,11869,14677,13647,13792,7657,10171,12112,15113,11954,7143,13627,14556,13533,8034,13240,11977,11896, 7891,14650,13682,11194,7654,12783,13925,11746,15880,4091,12070,14760,6134,13734,10220,13737,15648,8076 ,14731,13763,11119,13926,11221,13855,7886,12991,7981,15009,11691,14919,13547,13724,7644,8024,12168,146 91,15888,13655,11222,13684,8007,13223,15552,11678,7160,14623,14087,11167,14519,6137,13266,13629,7893,1 1487,14570,15904,14461,14893,7866,10226,13171,15430,11927,8082,13050,14996,11956,14952,13534,12099,792 0,8036,12791,11883,14678,11736,14652,13738,10173,15404,7987,13213,11719,14577,12060,6911,13765,15114,1 3549,7982,13166,12073,14899,11978,7607,13871,11235,8097,13023,10199,11985,15491,12101,7133,14681,14145 ,10174,14116,11980,7658,14788,14024,11005,14733,14146,13973,7791,4093,11196,12128,14739,14120,14091,15 441,7839,14543,12074,13929,11127,13916,7907,13281,15410,11870,15010,13745,11225,14894,6138,14032,8084, 12176,15121,15433,14768,14128,11237,7631,13173,15375,11986,8011,13227,14693,11960,14523,6111,13282,141 48,11641,15680,7549,11699,14572,15000,13659,10203,14209,15493,7665,13268,14960,12081,7147,14923,13555, 8098,13214,7989,13052,11583,15116,11885,15412,13974,7894,8129,10228,13229,12076,15383,11748,7134,15041 ,13766,13630,11694,7149,8040,14462,13987,11226,14578,13930,10215,15494,4094,7660,14901,12102,14734,142 10,14093,11931,7799,14682,11752,14792,13688,11183,13740,7897,13255,11503,11642,14694,13977,14741,14048 ,7868,11723,14639,11886,14905,13879,11131,7611,13174,15744,11891,7909,11238,11701,14580,6140,13119,1415 2,11644,15436,15497,14931,13937,11006,10232,13550,15442,8013,13235,14525,12082,14902,13671,13769,8088, 7550,12795,11725,15012,15416,13711,14099,15387,7990,13177,11760,15457,11933,7103,14697,13903,8019,1327 2,13990,11943,15042,7898,13746,10751,14925,13989,7666,9983,13039,15399,11988,8048,14551,15122,13661,12 105,7910,13230,7613,14983,11893,14684,13557,10205,7639,7803,11615,14755,11731,14742,13770,14800,13978, 8100,15016,11702,7155,15137,13932,11228,7855,13284,12001,11515,15619,11726,14698,6127,13675,11706,1544 4,11705,14926,13439,11241,14745,13503,15498,8071,13259,11191,11733,14906,14094,13719,15505,7993,11511,1 5124,11947,13748,13938,15621,7668,13178,15389,12106,7157,13883,11242,13777,8014,12797,13993,12002,1493 3,15403,13558,14908,14019,7913,10219,13237,15458,12163,7994,14555,14647,7900,13261,13662,11934,7614,81 30,15044,12047,14934,13911,10206,13980,15875,8104,14937,12113,14987,10221,14757,14102,7643,13288,8021, 15128,12084,15138,13772,11133,8035,13180,7805,11992,14947,12192,15448,14938,13561,12055,15500,11631,70 39,14746,13994,11215,14567,13885,12165,8075,11134,15024,11894,14989,13723,14115,15390,11949,14584,1210 8,7150,14101,15506,7655,13238,11897,11975,14705,14021,13677,7863,13752,11517,14526,11955,13940,14700,1 4001,7914,13151,15431,12088,7996,14990,13686,11249,7921,13047,13735,12166,15622,8022,11950,14995,6135, 13778,10175,14105,15625,8025,14671,14816,13562,11195,13683,7672,13296,7967,14651,12004,14557,13793,138 86,7423,8132,12114,14706,11639,15521,14949,13725,8077,12798,15936,11708,7158,14758,13915,11244,14761,1 3678,7887,11734,14787,15405,14950,11747,14879,1

0227,15460,11679,7645,13267,14571,11749,14748,1
3780,121
69,8083,13241,12059,14679,11737,14708,13967,142
12,16000,11898,15111,12008,7161,14117,14653,139
27,7806,
13051,12116,12224,7916,13996,11250,8112,13262,1
4022,12129,15411,11957,14558,13741,10229,14106,
15508,80
37,14762,13564,11197,13685,13917,7659,7867,1478
9,12061,14573,14160,14002,15406,7922,14895,1543
5,14025,
11223,13944,8026,13242,15626,12170,15169,13794,
11198,15140,6139,14118,7646,11979,15048,15633,1
5170,149
97,8136,13167,15877,12071,7551,13269,15144,1173
8,15115,13739,11900,15464,8078,11958,14953,1151
8,14940,
14216,10111,15522,7983,13270,14769,11981,7162,1
5056,13726,8144,13215,11839,15152,12177,15413,1
3535,803
8,10222,12062,15553,12075,7135,15172,13975,1400
4,11643,8085,14683,14147,11227,15233,13931,1378
4,15512,
4095,11961,14579,13767,14108,15437,7895,14998,1
1695,14121,11252,14026,7661,13283,15524,11871,1
4790,140
33,14654,14149,8041,11753,15011,16128,14954,140
28,11239,7869,13053,15628,12130,8099,15234,1198
7,15117,
6141,13244,14176,11750,15634,15878,14712,14764,
10230,14122,15414,7924,13175,15001,12172,15072,
13918,80
28,7667,13273,11982,14903,12077,15443,14224,154
17,7899,13285,11740,15881,12120,7164,15176,1403
4,14008,
12103,14961,7991,13689,11256,14574,13747,10233,
15472,11989,8090,14695,14793,14129,11962,8042,1
4735,121
78,15123,13631,13933,8086,12016,12132,14927,141
24,15014,13796,7670,14770,12083,15013,13742,110
07,8101,
13274,15495,12078,15438,11703,14685,6142,14150,
12193,15649,15554,14581,13979,11229,13800,15445
,7911,13
231,14794,11754,15002,13551,13690,15636,7928,11
887,14956,15882,13771,13934,15418,8049,13179,15
528,1193
5,7151,14699,13939,7662,13286,13749,12003,14463,
15499,13692,14527,7870,10234,13054,15459,12180,
8089,15
118,14743,14130,11727,7669,8044,14772,12107,149
62,13773,10207,15446,8015,14907,11645,14801,138
08,15017 ,13981,8160,14582,11761,15043,13991,112
43,7615,12799,12194,12085,15420,14686,14036,119
90,15640,12225,1
4935,14153,11230,15004,13941,15449,7901,11245,1
2136,15126,13663,13779,15650,15889,14796,11756,
13750,15
884,7995,13276,15556,11895,14585,14049,13563,81
02,13774,11993,15018,15501,13754,14909,13753,80
50,13289 ,15461,11964,8105,14747,15139,8131,1323
9,13781,11707,15507,7915,12005,15125,13559,1023
6,13995,15536,76
73,15045,14701,14776,14154,8023,13290,8092,1496
4,12109,15025,14050,7902,7997,12184,14710,11646,
15502,1
4759,14211,15890,12086,7159,14802,13982,11199,1
5129,14095,12115,15681,14586,11994,14707,14161,
15391,11
762,14817,12144,14910,14132,15560,8133,13181,12
006,11709,14749,14040,14240,15450,11735,14939,1
1899,141
03,14702,13679,8106,13263,15905,12196,8052,1421
3,11251,7674,13182,13942,11951,15652,15682,1480
4,13997,
10223,14156,15892,7917,14991,15236,13945,14023,
8113,8134,15141,12167,14951,13565,14003,15623,7
923,1502
0,12089,15509,15046,14136,8027,13297,15462,1176
4,14765,14214,11253,15130,13998,8108,12110,1458
8,15465,
14709,14941,15664,12009,7998,13243,15184,12090,
15026,14052,11996,8079,11710,15049,12226,14968,
14162,13
687,15656,14818,12200,7163,15142,13756,8039,132
92,11739,12117,15523,13782,7807,13795,12131,154
52,11901 ,14763,13727,13797,15407,8056,15240,142
17,11135,14107,13785,15627,7647,12171,14750,139
46,14056,15745,8
114,14559,15906,14164,11246,14272,7918,13298,15
684,11751,14999,14177,15028,14005,8137,11959,15
171,1556
8,14955,14808,7676,13245,15746,12010,8029,14791,
12092,15132,14109,12017,15510,15513,15145,12118
,15050,
10231,15525,7925,13271,15057,12121,15173,14218,
8138,13246,11768,15052,12063,15466,14027,15415,
11519,15
688,12228,7165,15200,14119,13786,12173,8087,139
48,11254,15146,14006,13566,15896,11983,14942,14
029,1593
7,8043,15248,11741,13887,14225,8030,15908,12179,
15058,14110,15032,14123,7926,14713,15473,14771,
13691,1
1257,8116,13275,15514,11902,15439,12012,15153,6
143,14009,12208,15629,15468,14655,14957,13743,1
5938,814
5,13300,15148,12133,14820,13919,15584,8091,1175
5,14766,11963,15526,13801,15879,8140,13287,1591
2,12018,
7166,15174,14178,14035,12122,15003,15555,13798,
14824,10235,15630,11742,7929,14575,14714,14220,
12232,80
45,14795,11647,14958,14030,14125,16001,12174,14
963,13788,14773,14168,8120,14716,12079,14151,11
258,7663 ,13304,15883,12240,15635,15154,14037,12

134,15940,15651,14797,14010,11231,14226,15419,7871,14832,12181,
15005,14064,14180,15529,15920,15015,15474,14131,15637,8103,13055,15516,11991,15060,14126,8146,13751,11
757,15177,15447,14241,14965,8051,13277,15557,12137,7930,14687,14803,13802,11965,15476,7671,12195,14774 ,13935,10237,15530,8093,15073,14587,14798,13983,8046,14778,12020,14777,14051,7903,12124,11763,15421,14
805,14228,15891,11995,14583,13775,11260,15019,14155,15885,16002,12087,15178,13693,15641,15638,15074,12
186,13809,15886,8161,13291,15537,12138,15235,14242,14133,15653,12182,15006,15748,14038,15119,14273,805
3,13278,15451,11766,8107,15185,8162,13293,14184,12197,15944,16129,15156,10238,13804,15558,8148,15064,1
5264,13943,8094,7932,15127,12007,14703,14041,15532,8109,15237,12024,15480,14966,14012,15561,12145,1502
1,13755,11247,15180,14053,11758,15696,14969,15047,15422,11966,14589,12185,15027,14157,15642,8135,11765 ,12140,15160,14232,13694,15503,15238,12111,15022,14134,8054,13247,15463,12256,15538,14163,7999,14042,1
1711,15654,15453,15076,13810,14192,16004,8115,15186,14711,14054,13757,15562,7675,11997,14780,13783,139
47,15952,8057,14806,15683,14819,14244,8152,13299,15752,12091,14751,13999,14821,7919,12198,15241,15657,
15131,14809,16130,12146,8110,14970,12201,15080,14215,12227,15467,15188,12011,15296,14137,15540,15201,1
1769,15029,13812,8164,13301,12119,12188,15511,14158,15569,11998,15644,12093,15133,14057,14138,16008,81
39,14044,11255,13758,14274,15454,15564,15242,14248,15658,8058,15051,15760,13787,14165,7677,15968,12229 ,15143,14179,14810,13949,8117,14972,15712,15030,14590,8141,13183,15685,12202,15893,12148,15053,14219,1
1770,15515,15570,14911,15249,15665,8168,13294,15134,12013,15147,13799,8060,12209,14715,12230,15907,140
07,15660,15469,12019,7167,15033,14058,14140,12123,15544,14065,14767,14166,15894,12204,14943,14169,1589
7,8118,14825,12094,13816,14111,15475,12175,15202,13567,15059,14276,8031,14822,15527,14221,11259,7927,1
3302,15585,12135,15686,15244,14031,11903,15666,16132,15054,15149,13789,15517,8176,14812,12152,15192,14
227,16016,15689,15175,11743,15470,15477,7678,13305,15572,12210,15061,13950,14060,12014,15034,15531,142
56,15250,16136,12233,8147,15088,15204,14181,11772,8121,12125,15155,13803,14011,15690,15150,14775,14066 ,7931,15265,12021,14170,8142,15586,12234,15909,14826,13790,15898,15747,14959,14280,11261,13695,15668,1
5576,12183,15007,14222,15776,15631,15075,15639,14127,15518,8122,13306,15697,12139,15252,14288,15910,12
126,14799,16032,14182,15179,8047,13279,15478,12022,8149,14717,14229,12212,15692,15939,14833,10239,1590
0,8150,15266,15157,14039,8095,15062,12241,15297,13805,15749,12187,15533,15208,14185,15481,12236,14013,
11262,14828,14243,15913,15559,14967,16144,15539,15065,12025,14068,15588,8163,15698,12141,15036,14172,1
3811,15672,14779,16064,15077,14043,7933,13308,15750,12216,15534,8124,14135,11759,15914,15941,15181,142
34,15753,8055,15256,14718,14186,15643,8153,11967,15158,14230,15482,8165,15187,15808,15066,13814,15713,
12199,14834,14245,15216,12242,15921,15078,14781,15563,12147,14807,12026,14971,14055,15423,15700,11767,
15268,14072,15754,15023,12189,14193,8154,13295,15887,12142,15942,13806,15916,11999,15541,15655,15239,1
4014,14233,15645,8111,15161,13813,14188,15592,15484,14836,14159,15565,8059,15182,15542,14304,8166,1600
3,12257,15081,13759,15162,7934,15068,15922,14782,15298,15646,12149,15945,12203,15272,14045,12258,15659 ,14811,15189,15714,15203,12244,14973,14139,7679,12190,12028,15571,14246,15761,15545,12205,15243,14194,
14249,15756,15704,14275,14059,15946,16005,14823,13817,15953,8156,15031,15895,14167,14236,15600,12231,1
5082,14046,15164,14141,8169,15089,15566,15190,8119,13303,15455,12150,15687,15193,12095,15924,16160,148
40,15135,15762,8170,14591,12211,15300,14277,15716,15245,11771,15667,15661,15777,12153,15055,14250,1419
6,12248,15573,13818,14813,15928,12015,15251,14061,16192,8061,12206,14257,14278,15948,14974,15084,14067 ,8143,15280,15546,14171,8062,16006,12260,15764,15205,14252,15587,16256,14827,15035,14142,15954,15778,1
2235,15090,14223,15662,16009,15194,16131,15720,8177,13307,15899,12154,14814,14183,11773,15304,15471,13
951,14719,15691,12213,8123,15246,14200,12237,15574,15151,13791,15669,15312,14258,8172,15206,12264,1406 2,15548,12156,15809,15253,14281,15577,15768,13820,11263,14173,15969,15956,15063,15911,16010,14829,1558 9,14069,15519,8178,15780,12214,15209,14282,15670,15037,15901,15267,8125,13309,16133,12127,15970,14231, 12023,16017,15693,15092,15479,8151,15196,14835,14187,8126,12272,15067,14174,15960,15699,15159,14070,15 578,11774,14260,15258,15728,16012,15210,15590,15751,15254,12243,14289,15673,15810,12217,14838,14235,15 902,15269,15694,14284,8155,13310,15593,12027,15915,16134,12238,15535,15483,15079,14073,16018,8180,1509 6,14189,15972,15701,15217,16137,8167,14830,15580,14264,15674,12218,15038,13807,15257,15784,14837,15212 ,15755,12143,12245,15183,14015,16033,15943,15328,15715,14783,12246,14247,8184,15647,12191,15543,14290, 15594,15485,15917,15069,14195,14074,16020,15976,13815,15702,15676,15163,14237,15601,7935,15270,16138,1 4190,15923,12259,15218,14047,15273,8157,15299,15705,15083,15812,12029,15757,14841,12220,15763,15191,15 260,15567,15070,12151,15165,14305,16034,12249,15918,16145,15792,12261,14197,14251,15717,15547,14306,15 596,16024,15301,14292,15984,8171,15947,14238,14076,16140,15274,15220,14253,8158,14842,16065,8173,15486 ,12250,15602,15085,15925,15758,15281,15302,15706,15816,12207,15091,14279,15718,15195,15765,15663,15929 ,12155,15276,14198,12262,15604,14143,15166,15955,12030,15247,14259,15549,15926,13819,16036,15207,14201 ,8127,14975,15721,14296,16066,11775,15949,15224,14063,15575,16146,14815,14254,16007,15708,15282,15779, 15766,15086,15824,16040,8179,16161,12252,15305,14308,14844,15722,15197,15950,12265,15769,14283,12215,1 5930,15093,16148,15306,14202,8181,12266,13821,15957,15932,15255,14261,15579,15671,14285,16068,15958,15 211,15961,16011,15198,15781,14312,16152,16162,12157,15094,14204,15971,15284,15962,8063,13311,15770,122 39,15591,12158,16048,16013,15313,15608,8174,15259,14262,15729,15308,15550,15724,14175,16014,12273,1407 1,15097,16019,15213,15695,15840,12219,14320,15675,15581,15288,15730,14831,15973,13822,8182,15782,12268 ,15785,15811,15974,15903,15039,14291,15595,15772,14265,15703,15732,15271,16135,8185,15314,15677,14075, 12274,15219,14286,15098,15582,14839,15786,12221,15261,15813,15597,15214,15919,15071,12247,14266,16193, 12222,16164,16072,16194,16021,14191,14293,16168,16139,15977,15964,15329,14294,15793,8186,16080,14239,1 6176,15221,15275,8159,15330,16196,15707,12251,16257,15316,15603,15262,15100,16022,12276,15277,14307,15 814,15678,16035,15978,12263,14077,16258,16141,14268,15736,15788,15303,14199,16025,16096,14297,15927,15 222,14309,8188,15167,16200,15985,12280,15598,15283,15719,15817,14843,15759,16147,15225,15951,15320,160 38,15794,16037,12031,15087,14298,15709,15278,15605,12253,14255,15818,16026,15980,15332,14203,8175,1572 3,14310,15487,15551,15307,14078,16142,15767,15796,15986,15226,15931,15825,14845,16041,15606,16067,1226 7,15285,13823,15309,15710,15959,12254,16028,12269,16150,15336,15820,15228,14300,15609,16042,15933,1431 3,15771,16163,14263,16149,15286,16069,15725,15800,14314,15988,16049,15199,15734,15095,15783,8183,15826 ,12223,16153,15610,15731,15344,15841,15934,14205,15773,14846,15963,15726,14287,12275,14206,15315,15828 ,15289,16015,16260,16165,15975,15099,16044,15310,16070,14321,15789,12277,16154,15612,15733,15965,14267 ,16208,16050,16073,15992,15290,15842,8187,16166,14316,15215,15317,15787,16264,12159,15318,15774,15263, 15583,12270,14322,16023,16052,16195,15979,15832,14269,15815,16156,16169,16074,15331,14295,16081,16197, 14270,16076,15101,8189,15292,16224,12278,16170,15223,15966,15321,16272,15333,16082,16056,15737,15795,1 2281,14299,16177,15679,15981,14324,16172,15844,15790,15322,14311,8190,16198,16027,15848,15279,15599,15 738,15819,15982,15227,15987,15334,15797,15740,12282,15102,14328,16178,15821,12255,15856,16029,16039,14 847,14079,16084,16201,15989,14301,15711,15827,15798,15324,16097,15611,15822,15802,15801,15337,15287,15 829,15607,12284,16043,16202,15338,16098,14315,16259,16030,16143,14302,16209,14317,16180,15229,16088,16 288,16151,15727,15311,16261,15230,15990,16045,12271,16204,15993,16071,15613,16051,16184,15345,16262,16 046,14271,15291,16100,16210,15735,15804,15340,15830,15843,14323,15775,15845,16265,16155,15833,15994,16 104,16212,16320,15346,16225,16053,14325,15293,16157,12279,15319,16266,15294,16075,16167,15834,15996,16 054,15614,14207,16077,15935,16273,14318,16158,1

6171,15739,15323,8191,16057,15791,15348,15967,15849,153 35,16226,16083,15846,12283,14326,16268,16078,16173,15836,16216,16199,15352,14329,16085,16058,16274,161 12,16228,16179,15103,16174,15799,16289,15325,15850,15983,12285,16031,16099,14330,16276,15823,16203,143 03,15741,15857,15339,16290,16181,16086,16321,15326,15341,16232,12286,15852,15991,16089,16060,15803,161 01,14332,16205,16280,15742,16182,15295,16211, 16090, 15858, 16240, 16102, 15805, 15831, 15995, 16292, 15347,160 47,14319,16263,16185,15860,15349,16206,16105,16186,16092,15806,16322,16296,15835,16213,16227,15997,152 31,16267,15342,15847,16055,16106,16188,16113,16214,14327,16217,15864,16159,15615,16324,16269,15350,160 79,15837,16275,15353,15998,16108,16304,16229,15851,16059,16114,16218,14331,15838,16328,15743,16270,161 75,15354,16336,16230,15327,16277,12287,16087,15853,16233,16061,16291,14333,16116,16220,15859,16091,153 56,16183,16282,16234,16278,15862,16293,14334,16103,16120,16241,15343,15854,16062,16281,15861,16236,162 07,16352,15807,16093,16187,16294,16242,16297,16323,16107,15865,16215,16284,16094,16189,15351,16325,162 98,16244,15866,16109,16305,16326,16115,16219,16300,16190,16271,15355,16231,15999,16248,15839,16306,161 10,16329,15868,16221,16117,16330,15357,16279,16235,16222,16118,16308,14335,16337,16283,16332,15358,161 21,16237,16312,15855,16063,16295,16338,16243,16122,15863,16285,16238,16095,16353,16245,16299,16354,163 40,16286,16124,16301,16327,16246,16191,16307,15867,16249,16344,16111,16302,16356,16331,16250,15869,163 09,16333,16360,16252,15359,16310,16223,16119,16368,15870,16339,16313,16123,16334,16314,16239,16341,163 42,16287,16355,16125,16316,16247,16345,16357,16346,16303,16251,16358,16126,15871,16348,16361,16311,163 62,16253,16335,16254,16369,16315,16364,16370,16317,16343,16318,16347,16372,16359,16376,16127,16349,163 63,16350,16365,16319,16371,16373,16255,16366,16374,16377,16378,16351,16380,16367,16375,16379,16381,163 82,16383]

**Sequence group 4: Z4_16384**

[0,1,2,7,3,8,11,24,4,10,13,28,16,33,35,77,5,12,14,32,19,38,47,81,22,46,42,88,57,96,102,168,6,17,21,40, 23,45,51,90,29,55,59,97,72,111,117,188,34,61,75,115,80,124,134,200,87,136,147,227,152,239,260,389,9,18,26,54, 30,58,71,105,36,76,62,118,84,128,141,209,44,74,86,135,92,144,151,233,100,154,170,251,186,269,289,436,53,89,9 8,150,112,161,179,266,122,180,199,281,211,306,325,477,138,207,230,312,236,326,352,512,257,361,382,540,403,5 68,617,889,15,25,31,73,39,79,82,140,48,85,93,149,101,159,165,263,56,94,103,162,116,178,196,284,127,197,208,2 99,232,321,346,499,64,109,123,185,129,198,215,315,148,228,237,328,256,359,374,539,163,247,267,365,282,398,4 06,565,308,422,459,602,487,640,721,892,69,125,143,218,158,235,254,363,169,258,272,388,290,405,435,591,194,2 85,300,419,327,449,482,655,342,491,520,689,548,735,766,1044,214,316,336,465,366,498,525,709,402,535,566,75 2,604,773,850,1140,431,577,618,812,635,873,907,1217,715,930,966,1201,1009,1280,1387,1799,20,37,41,91,49,95, 106,177,50,107,119,189,131,210,219,344,63,120,132,224,145,231,245,345,153,244,261,380,286,401,411,564,67,14 2,155,226,173,248,268,399,183,278,291,414,305,446,470,630,181,301,319,445,341,483,503,690,369,527,549,733,5 74,760,821,1113,78,167,174,275,192,297,317,437,201,324,333,479,353,510,533,730,259,347,368,518,391,545,573, 755,425,584,624,807,658,870,914,1190,296,384,415,559,444,601,628,853,473,648,670,887,722,946,978,1259,522, 719,738,967,756,1011,955,1306,832,1101,1141,1409,1153,1549,1621,1892,83,190,195,340,249,358,373,526,276,3 78,392,554,424,586,622,856,292,420,441,589,462,629,662,896,492,673,708,937,753,974,1041,1324,343,447,468,6 61,501,698,744,957,552,745,768,1032,833,1005,1123,1423,599,796,863,1104,898,1151,1196,1500,948,1207,1205, 1601,1312,1651,1713,2106,383,489,529,747,585,771,820,1061,625,854,876,1144,925,1164,1203,1540,663,904,961 ,1191,987,1213,1317,1655,1057,1332,1382,1726,1461,1822,1883,2333,731,969,1023,1320,1119,1327,1441,1759,1 137,1431,1511,1860,1581,1944,2071,2526,1169,1555,1643,1982,1693,2087,2028,2593,1792,2172,2234,2782,2364, 2887,3037,3442,27,43,52,99,60,121,133,216,66,137,146,223,157,242,246,395,68,156,166,241,175,298,309,430,203 ,311,339,474,355,505,531,750,70,172,191,304,205,337,349,496,217,362,375,536,397,569,596,775,229,386,410,580 ,439,621,642,839,451,631,676,903,687,935,970,1397,110,204,212,354,225,376,396,558,252,412,426,609,455,652,6
72,861,274,429,467,638,494,684,693,916,517,696,706,977,793,1012,1090,1427,293,493,508,704,544,740,749,995,
572,792,824,1056,880,1114,1145,1516,607,848,899,1150,949,1187,1266,1587,1020,1277,1336,1656,1383,1733,18
39,2312,113,221,243,407,271,427,461,657,288,471,497,697,523,713,724,989,323,509,542,728,571,786,815,1050,6
05,835,878,1134,917,1171,1236,1524,350,556,595,822,643,865,862,1174,664,905,932,1218,999,1271,1292,1666,7
12,951,1015,1281,1053,1348,1386,1763,1100,1417,1480,1861,1598,1959,2080,2548,371,615,650,909,692,945,100
1,1278,783,1019,1067,1372,1075,1393,1455,1815,798,1070,1099,1439,1181,1476,1565,1941,1252,1590,1638,1991 ,1711,2124,2184,2614,837,1200,1227,1527,1302,1605,1650,2049,1337,1706,1771,2164,1841,2247,2347,2810,1486 ,1776,1869,2263,1976,2381,2439,2995,2056,2500,2586,3083,2694,3245,3406,4041,130,253,279,472,320,507,538,7
59,330,547,578,789,610,829,895,1239,364,597,656,857,678,942,922,1257,699,962,1007,1331,1062,1357,1402,179
3,440,666,701,938,782,993,1025,1379,788,1066,1086,1404,1117,1456,1498,1905,800,1110,1161,1493,1249,1560,1
629,2000,1287,1686,1709,2138,1774,2186,2287,2759,453,780,785,1054,805,1072,1131,1468,845,1184,1224,1543,
1273,1616,1698,2095,1014,1244,1305,1635,1342,1727,1781,2177,1463,1788,1874,2269,1981,2367,2428,2989,108
1,1346,1438,1731,1487,1855,1915,2307,1574,1954,2014,2423,2088,2506,2608,3151,1646,2065,2154,2583,2232,26
67,2752,3268,2325,2793,2881,3386,2934,3587,3612,4472,466,808,828,1233,990,1264,1290,1680,1035,1329,1369,
1746,1452,1807,1898,2293,1093,1398,1483,1826,1535,1925,2019,2406,1620,2083,2008,2472,2178,2601,2693,317
8,1253,1502,1559,1963,1663,2031,2144,2565,1721,2157,2228,2671,2278,2704,2819,3366,1843,2252,2342,2774,24
44,2900,2972,3512,2522,3066,3131,3681,3253,3782,3814,4280,1343,1567,1714,2160,1801,2214,2253,2737,1889,2
358,2387,2863,2482,2906,3089,3605,1910,2464,2572,3058,2687,3154,3170,3804,2799,3277,3340,3885,34
85,4062,
4171,4774,2102,2649,2674,3226,2841,3288,3393,3932,2926,3505,3535,4150,3708,4179,4497,5010,3018,3658,376
1,4338,3911,4394,4585,5215,3992,4635,4752,5388,4891,5534,5659,6334,65,104,114,184,126,187,220,314,139,206 ,234,338,264,372,387,600,160,222,240,370,283,400,452,614,307,450,423,646,506,681,714,968,171,265,295,417,31
0,448,478,654,351,490,513,685,576,748,774,1034,377,524,593,765,611,801,834,1079,644,843,883,1167,913,1212,
1279,1658,202,270,331,485,356,511,570,723,393,598,532,776,636,813,869,1108,434,590,639,840,671,875,902,118
5,705,919,976,1241,1031,1300,1365,1783,484,647,688,894,751,936,1003,1294,791,1010,1076,1341,1112,1415,146
9,1890,852,1103,1175,1435,1194,1472,1546,1980,1265,1577,1633,2047,1690,2120,2242,2855,250,329,360,583,40
9,606,620,867,456,637,674,890,707,933,956,1289,504,677,716,940,767,1000,1064,1352,810,1065,1106,1395,1179,
1459,1531,1949,541,739,795,1028,818,1069,1124,1443,885,1172,1199,1481,1263,1573,1609,2046,944,1231,1296,
1589,1345,1677,1699,2115,1421,1744,1845,2206,1921,2296,2486,2859,562,804,872,1135,928,1189,1251,1585,971 ,1269,1309,1653,1366,1696,1778,2182,1055,1355,1396,1739,1474,1820,1903,2328,1521,1928,2003,2409,2072,251
9,2590,3183,1122,1447,1508,1857,1593,1945,2016,2454,1689,2038,2118,2552,2210,2606,2771,3370,1768,2142,22
44,2692,2285,2822,2894,3521,2469,2941,3015,3491,3106,3643,3843,4569,287,394,421,669,458,679,726,998,464,7
29,778,1038,826,1111,1139,1526,534,784,830,1160,879,1177,1226,1528,915,1225,1283,1626,1356,1683,1717,2113 ,553,871,923,1163,984,1235,1299,1678,1022,1330,1370,1725,1413,1811,1872,2274,1013,1401,1453,1808,1519,19
08,1958,2411,1600,2022,2078,2516,2135,2573,2711,3318,603,965,985,1318,1048,1389,1449,1785,1080,1467,1496 ,1895,1552,1974,2033,2509,1276,1533,1596,1998,1661,2062,2134,2561,1751,2161,2258,2682,2338,2817,2907,346
9,1385,1641,1730,2105,1806,2204,2268,2778,1879,2314,2365,2850,2489,2977,3045,3602,2010,2479,2525,3016,25
62,3108,2994,3695,2732,3300,3371,3882,3400,4134,4266,4723,633,1042,1059,1515,1237,1571,1607,2018,1322,16
19,1665,2091,1749,2169,2251,2787,1373,1742,1797,2176,1852,2270,2346,2868,1930,2372,2452,2958,2554,3034,3
176,3724,1525,1813,1866,2345,1952,2429,2535,2997,2086,2537,2596,3158,2734,3098,3337,3908,2198,2654,2805,
3303,2875,3394,3481,4051,2980,3502,3499,4231,3705,4312,4423,5077,1636,1924,2025,2542,2167,2603,2709,321
2,2260,2779,2829,3380,2931,3419,3494,4118,2348,2886,3005,3471,3063,3513,3713,4322,3204,3737,3833,4446,39
77,4609,4708,5431,2511,3023,3137,3718,3330,3727,3946,4504,3362,3926,4069,4672,4192,4813,5017,5726,3428,4
145,4299,4875,4390,5043,4946,5821,4557,5176,5281,6098,5478,6247,6460,7011,334,428,480,695,519,787,831,11
27,551,844,881,1158,926,1220,1229,1671,560,924,959,1215,988,1391,1425,1764,1088,1429,1513,1881,1558,1961,
2030,2546,567,980,1045,1410,1097,1510,1539,1942,1129,1583,1613,2040,1676,2122,2193,2612,1173,1649,1712,2
151,1790,2250,2299,2749,1824,2276,2379,2885,2404,2952,3025,3860,742,1091,1116,1553,1162,1614,1673,2100,1
246,1719,1755,2221,1836,2322,2370,2798,1315,1761,1864,2290,1937,2400,2419,2913,1995,2425,2446,3042,2646,
3110,3274,3917,1377,1935,1968,2443,2061,2528,2544,3080,2129,2645,2717,3202,2838,3320,3382,4077,2217,276
8,2877,3392,2983,3461,3614,4202,3128,3634,3746,4324,3838,4459,4642,5404,758,1148,1222,1704,1304,1756,185
0,2336,1360,1873,1943,2427,2012,2462,2495,3069,1466,1973,2053,2504,2127,2631,2699,3193,2211,2740,2832,33
58,2915,3431,3559,4090,1541,2097,2191,2715,2304,2808,2800,3438,2353,2888,2948,3523,3087,3623,3668,4344,2
461,2986,3119,3645,3196,3770,3841,4513,3295,3896,4011,4674,4222,4836,5030,5754,1603,2236,2319,2897,2417,
2975,3091,3635,2627,3127,3223,3819,3242,3853,3966,4595,2658,3231,3293,3940,3449,4001,4165,4805,3590,421
0,4291,4888,4421,5103,5198,5855,2743,3490,3540,4097,3686,4236,4311,4981,3748,4411,4525,5165,4645,5296,54
52,6136,4024,4534,4687,5321,4864,5507,5590,6402,4994,5682,5808,6523,5970,6747,6957,7772,823,1247,1334,18
75,1454,1966,2045,2570,1485,2069,2145,2639,2225,2727,2866,3563,1588,2196,2330,2789,2385,2968,2924,3599,2
433,3007,3101,3735,3214,3790,3870,4559,1791,2356,2436,2960,2624,3077,3141,3830,2637,3221,3265,3873,3327,
3968,4048,4748,2664,3313,3413,4037,3582,4156,4277,4902,3655,4379,4414,5126,4528,5201,5359,6069,1829,262
1,2629,3200,2675,3234,3351,3988,2761,3457,3533,4122,3626,4255,4399,5057,3117,3573,3693,4287,3757,4447,45
40,5186,3980,4549,4695,5331,4874,5482,5576,6392,3254,3767,3938,4456,4025,4664,4768,5395,4180,4826,4923,5
566,5044,5693,5844,6617,4302,5006,5149,5805,5276,5932,6059,6775,5419,6111,6237,6931,6317,7197,7231,8296,
1859,2684,2725,3551,3071,3611,3664,4368,3165,3733,3811,4482,3960,4582,4735,5371,3282,3862,4015,4619,410
9,4782,4933,5544,4264,5033,4913,5642,5187,5833,5969,6655,3592,4056,4155,4841,4335,4955,5136,5780,4437,51
52,5272,5936,5344,5985,6152,6906,4650,5305,5443,6085,5600,6262,6368,7100,5717,6500,6590,7320,6758,7450,7
491,8064,3758,4168,4425,5160,4572,5249,5307,6035,4719,5466,5518,6214,5656,6274,6534,7220,4759,5629,5791,
6487,5959,6620,6644,7478,6122,6788,6878,7583,7063,7798,7930,8643,5068,5907,5943,6721,6188,6802,6942,763
8,6304,7088,7130,7906,7355,7942,8324,8911,6432,7291,7422,8134,7612,8201,8428,9139,7717,8485,8618,9327,87
76,9483,9613,10303,108,164,176,273,193,277,318,442,213,302,335,475,379,516,537,803,238,322,348,514,404,550 ,619,817,433,616,582,858,683,901,939,1245,255,381,416,575,438,613,649,866,486,667,694,906,770,979,1016,132
8,521,710,794,1002,814,1043,1087,1375,855,1095,1146,1484,1178,1532,1612,2050,294,385,463,660,495,691,764,
954,543,799,717,1018,846,1063,1128,1414,592,790,851,1092,888,1138,1166,1501,927,1188,1255,1570,1321,1640,
1715,2195,659,859,911,1157,983,1210,1288,1632,1033,1293,1371,1682,1419,1767,1831,2311,1105,1408,1491,179
5,1512,1834,1920,2416,1595,1957,2021,2494,2090,2578,2714,3397,357,460,502,777,561,809,825,1126,623,847,89
3,1152,931,1204,1230,1623,680,897,943,1214,1008,1285,1358,1697,1058,1359,1412,1747,1495,1823,1906,2382,7
25,972,1037,1316,1068,1364,1430,1805,1147,1488,1518,1842,1592,1951,1996,2493,1219,1557,1634,1972,1688,20
76,2099,2571,1775,2150,2267,2673,2351,2775,2982,3402,757,1047,1133,1440,1198,1507,1582,1965,1250,1599,16
52,2044,1716,2096,2190,2644,1350,1701,1748,2143,1835,2233,2327,2813,1894,2361,2442,2903,2518,3021,3097,3
753,1428,1810,1878,2281,1977,2378,2458,2949,2089,2485,2575,3059,2680,3116,3302,3955,2180,2602,2716,3211,
2758,3357,3434,4117,2965,3489,3568,4085,3670,4251,4469,5243,408,546,579,884,626,900,958,1282,632,963,102
1,1333,1078,1418,1446,1900,720,1026,1082,1473,1142,1494,1551,1902,1183,1550,1617,2015,1703,2084,2117,256
9,746,1132,1192,1479,1267,1562,1639,2077,1308,1670,1722,2126,1766,2223,2294,2747,1298,1754,1817,2219,189
3,2335,2389,2905,1984,2465,2524,3019,2595,3079,3233,3902,806,1240,1268,1660,1344,1741,1812,2197,1376,182
8,1863,2318,1926,2408,2478,3011,1606,1907,1979,2435,2052,2508,2594,3067,2159,2620,2730,3199,2821,3348,34
48,4065,1737,2029,2133,2558,2216,2672,2739,3308,2302,2797,2847,3391,2985,3529,3601,4208,2450,2974,3029,3
570,3068,3673,3546,4309,3260,3877,3957,4510,3984,4780,4919,5406,842,1338,1354,1888,1564,1948,1994,2460,1
664,2009,2058,2541,2158,2628,2724,3316,1724,2147,2209,2636,2275,2742,2828,3411,2363,2856,2947,3509,3060,
3589,3745,4342,1899,2224,2289,2827,2384,2923,3041,3550,2534,3043,3105,3723,3262,3662,3923,4536,2663,317
1,3334,3881,3417,3979,4076,4686,3532,4095,4093,4881,4320,4968,5087,5774,2024,2355,2467,3047,2626,3114,32
30,3787,2731,3310,3367,3964,3478,4010,4089,4765,2831,3427,3558,4067,3622,4108,4329,4977,3779,4356,4458,5
109,4614,5283,5392,6148,3013,3578,3700,4334,3914,4346,4576,5173,3948,4555,4707,5353,4838,5501,5711,6452,
4021,4790,4953,5561,5053,5737,5640,6548,5232,5879,5989,6837,6194,6992,7205,7767,469,587,653,918,703,1030 ,1083,1433,741,1096,1143,1471,1197,1544,1556,2068,754,1193,1234,1538,1274,1743,1782,2175,1388,1789,1886,
2303,1934,2393,2474,3052,761,1262,1340,1762,1400,1880,1912,2375,1434,1964,2001,2487,2074,2580,2656,3124,
1489,2037,2112,2610,2202,2722,2777,3279,2241,2748,2865,3425,2896,3501,3579,4488,975,1394,1424,1927,1478,
2002,2070,2551,1575,2119,2165,2691,2255,2807,2854,3326,1657,2173,2288,2767,2369,2891,2912,3456,2432,291
9,2940,3598,3164,3675,3850,4546,1729,2368,2401,2936,2507,3033,3050,3641,2588,3163,3241,3777,3377,3904,39
65,4718,2688,3298,3418,3976,3536,4058,4221,4850,3692,4241,4364,4978,4463,5122,5316,6116,992,1458,1545,21
04,1647,2166,2273,2820,1710,2295,2376,2921,2451,2957,2993,3630,1827,2407,2501,3004,2587,3148,3219,3765,2
681,3269,3369,3943,3458,4023,4162,4733,1914,2549,2653,3238,2784,3336,3329,4032,2835,3430,3496,4119,3650,
4229,4276,5000,2956,3538,3683,4252,3769,4386,4467,5182,3872,4524,4647,5355,4873,5524,5724,6483,1988,270
8,2803,3436,2911,3527,3654,4243,3143,3691,3798,4442,3816,4480,4603,5269,3175,3805,3869,4571,4045,4639,48
09,5492,4196,4860,4945,5574,5084,5804,5901,6584,3271,4083,4141,4742,4298,4887,4966,5678,4365,5075,5196,5
868,5320,6007,6171,6875,4659,5205,5368,6031,5551,6221,6314,7150,5689,6404,6536,7273,6703,7499,7714,8533,
1074,1576,1675,2298,1818,2399,2491,3076,1849,2515,2605,3156,2696,3252,3409,4167,1971,2660,2815,3317,287
4,3520,3468,4206,2927,3560,3666,4354,3788,4410,4498,5234,2203,2837,2929,3511,3139,3639,3704,4454,3155,37
96,3840,4500,3912,4605,4682,5427,3180,3894,4000,4671,4188,4800,4931,5589,4263,5041,5079,5829,5200,5903,6
071,6806,2248,3135,3146,3774,3192,3807,3937,4626,3292,4053,4131,4770,4233,4909,5062,5751,3682,4178,4307,
4940,4374,5111,5212,5889,4616,5223,5378,6042,5559,6199,6298,7140,3829,4384,4568,5120,4661,5343,5448,610
6,4825,5515,5614,6288,5739,6416,6573,7364,4957,5702,5853,6532,5984,6664,6796,7527,6135,6850,6982,7687,70
58,7957,7993,9053,2283,3201,3251,4154,3632,4217,4272,5029,3732,4351,4434,5148,4594,5256,5416,6082,3858,4
490,4652,5293,4756,5465,5625,6261,4917,5728,5602,6363,5891,6560,6701,7404,4198,4691,4798,5530,4991,5648,
5838,6508,5100,5857,5979,6669,6056,6717,6890,7662,5325,6016,6161,6825,6323,7008,7114,7858,6443,7246,734
0,8077,7509,8209,8251,8827,4376,4811,5089,5862,5245,5956,6018,6772,5401,6185,6232,6956,6377,7017,7283,79
83,5438,6352,6517,7233,6691,7368,7391,8237,6861,7540,7632,8344,7822,8560,8694,9400,5764,6640,6674,7474,6
926,7554,7698,8398,7046,7848,7887,8668,8116,8704,9081,9664,7179,8049,8184,8894,8372,8963,9188,9885,8479,
9241,9374,10068,9531,10221,10350,11014,736,952,996,1313,1051,1325,1450,1802,1120,1405,1505,1884,1624,19
92,2042,2669,1208,1464,1536,1985,1694,2081,2245,2705,1772,2238,2155,2790,2397,2882,2962,3575,1260,1630,1734,2139,1786,2230,2316,2811,1918,2359,2420,2892,2599,3048,3121,3730,2006,2456,2650,3094,2697,3181,3266,3822,2785,3285,3383,4017,3445,4105,4248,4983,1380,1644,1853,2343,1938,2413,2584,2991,2059,2661,2475,3125,2763,3216,3345,3890,2187,2641,2772,3280,2852,3364,3423,4054,2937,3463,3594,4173,3720,4295,4428,5216,2339,2794,2901,3407,3056,3507,3659,4282,3160,3671,3817,4372,3900,4520,4627,5402,3306,3879,4033,4563,4072,4632,4775,5557,4218,4831,4937,5675,5049,5798,6001,6946,1568,1847,1955,2617,2109,2685,2720,3342,2256,2765,2861,3398,2945,3497,3547,4268,2390,2870,2969,3516,3103,3651,3792,4397,3207,3794,3887,4484,4042,4610,4749,5508,2498,3030,3168,3711,3227,3802,3924,4578,3387,4027,4081,4648,4214,4822,4896,5673,3525,4151,4285,4857,4381,5024,5063,5789,4532,5144,5327,5941,5457,6088,6383,6951,2566,3189,3355,3944,3486,4063,4194,4846,3584,4226,4315,4973,4430,5059,5207,5897,3775,4402,4486,5134,4636,5279,5424,6140,4728,5471,5595,6267,5712,6438,6543,7410,3919,4587,4702,5348,4866,5502,5619,6338,5047,5661,5793,6489,5950,6569,6821,7667,5191,5835,6003,6699,6067,6896,6999,7870,6358,7069,7174,7829,7305,8029,8291,9170,1707,2066,2148,2844,2264,2878,3000,3647,2279,3009,3132,3740,3247,3898,3953,4739,2483,3144,3256,3997,3373,4038,4138,4743,3454,4136,4257,4926,4407,5036,5093,5787,2539,3353,3473,4008,3617,4158,4293,5026,3697,4352,4439,5107,4516,5262,5373,6049,3679,4495,4599,5257,4725,5434,5520,6270,4877,5631,5722,6434,5825,6518,6730,7601,2677,3566,3619,4330,3762,4473,4590,5219,3826,4623,4678,5411,4785,5548,5650,6421,4239,4753,4871,5585,4987,5698,5823,6502,5158,5863,6023,6685,6156,6886,7018,7802,4465,4950,5117,5770,5253,5938,6039,6830,5385,6118,6195,6939,6387,7121,7215,7978,5608,6373,6448,7176,6504,7309,7146,8097,6765,7572,7669,8339,7705,8650,8808,9345,2754,3750,3783,4716,4163,4818,4893,5622,4339,4915,4996,5744,5155,5875,6014,6842,4443,5139,5239,5887,5339,6043,6168,6964,5474,6207,6335,7094,6492,7201,7400,8138,4737,5266,5363,6166,5513,6299,6466,7152,5735,6468,6553,7374,6768,7295,7627,8368,5926,6646,6868,7578,6975,7699,7817,8546,7126,7843,7839,8766,8111,8865,8999,9734,4941,5462,5635,6473,5872,6566,6726,7456,6026,6832,6908,7680,7053,7736,7834,8632,6172,6989,7163,7804,7241,7859,8121,8875,7445,8156,8278,9023,8461,9212,9331,10119,6424,7185,7346,8129,7618,8143,8416,9089,7657,8391,8570,9290,8719,9447,9670,10418,7749,8662,8849,9512,8957,9699,9593,10513,9157,9844,9956,10791,10166,10936,11131,11632,1870,2170,2323,2917,2440,3152,3258,3929,2531,3289,3378,3994,3482,4124,4147,5012,2559,3475,3555,4114,3628,4476,4542,5183,3846,4552,4713,5389,4796,5526,5644,6480,2576,3607,3754,4511,3867,4704,4761,5496,3933,4843,4904,5664,5019,5801,5916,6579,4029,4964,5085,5848,5228,6012,6092,6791,5289,6053,6218,6987,6257,7083,7188,8313,3038,3855,3909,4787,4006,4906,5015,5760,4183,5096,5167,5967,5311,6131,6204,6858,4326,5179,5360,6077,5487,6252,6283,7028,5581,6292,6325,7211,6636,7312,7535,8379,4452,5484,5538,6319,5696,6454,6477,7268,5814,6634,6741,7442,6921,7604,7682,8582,5962,6817,6977,7695,7131,7792,7995,8731,7336,8018,8166,8877,8283,9038,9249,10086,3073,3972,4127,5073,4305,5169,5337,6153,4417,5375,5498,6295,5610,6349,6398,7251,4621,5546,5684,6412,5811,6612,6709,7427,5952,6778,6912,7653,7031,7752,7920,8597,4766,5756,5912,6736,6101,6873,6862,7761,6178,6993,7078,7872,7278,8005,8060,8900,6347,7135,7324,8032,7432,8194,8289,9101,7566,8356,8500,9292,8757,9472,9685,10448,4883,5991,6126,7003,6281,7118,7285,8020,6604,7334,7470,8257,7494,8304,8447,9199,6651,7480,7562,8410,7778,8490,8686,9438,7961,8741,8840,9526,8995,9764,9867,10546,6782,7827,7894,8606,8084,8772,8863,9632,8168,8984,9116,9833,9254,9976,10141,10827,8514,9126,9306,10001,9501,10192,10283,11081,9645,10374,10501,11193,10663,11397,11588,12282,3239,4185,4360,5379,4601,5535,5669,6514,4657,5708,5839,6625,5974,6756,6961,7925,4855,5921,6143,6845,6228,7109,7043,7975,6305,7165,7300,8153,7458,8219,8325,9160,5230,6183,6309,7096,6600,7265,7351,8273,6622,7467,7523,8329,7614,8450,8541,9369,6659, 7592,7725,8528,7951,8675,8822,9543,8045,8944,8989,9789,9121,9870,10039,10759,5299,6595,6609,7437,6675,7484,7645,8473,6808,7787,7884,8637,8009,8796,8968,9712,7321,7939,8095,8833,8178,9025,9135,9855,8464,9147,9315,10011,9511,10170,10268,11073,7510,8190,8406,9034,8515,9279,9392,10075,8705,9463,9567,10258,9700,10384,10536,11277,8853,9658,9815,10497,9952,10624,10749,11423,10105,10803,10927,11566,10996,11799,11829,12694,5351,6687,6754,7911,7254,7989,8055,8930,7385,8149,8246,9064,8437,9183,9357,10050,7546,8316,8504,9222,8623,9410,9578,10232,8806,9689,9556,10332,9857,10524,10662,11312,7964,8551,8673,9478,8890,9602,9800 ,10472,9013,9820,9946,10630,10026,10676,10840,11543,9259,9986,10132,10778,10292,10950,11049,11715,10410,11169,11253,11902,11407,12012,12046,12518,8180,8689,9001,9826,9173,9920,9988,10725,9341,10156,10202,10902,10345,10960,11202,11821,9381,10320,10483,11158,10652,11281,11302,12035,10813,11435,11514,12123,11684,12303,12412,12961,9725,10599,10635,11374,10872,11447,11575,12170,10985,11706,11739,12392,11933,12420,12716,13158,11108,11876,11990,12570,12148,12623,12797,13318,12234,12840,12942,13450,13060,13558,13647,14091,182,262,280,413,303,418,476,641,332,454,500,682,555,734,762,1098,367,481,515,732,588,779,868,1118 ,627,864,819,1168,950,1223,1270,1642,390,557,608,811,634,860,908,1180,700,929,964,1228,1060,1319,1361,1738,743,981,1089,1347,1115,1399,1448,1798,1165,1460,1520,1923,1561,1983,2079,2589,443,563,668,921,711,960,1049,1286,769,1094,991,1363,1154,1420,1499,1840,836,1084,1159,1457,1206,1509,1547,1946,1254,1572,1654,2027,1732,2108,2199,2751,920,1170,1232,1534,1323,1597,1692,2101,1384,1700,1794,2162,1846,2262,2334,2889,1475,1833,1933,2291,1960,2337,2438,3006,2057,2481,2553,3092,2632,3187,3339,4098,528,665,718,1071,797,1107,1130,1497,874,1155,1211,1529,1258,1591,1622,2092,947,1216,1275,1602,1351,1687,1777,2179,1416,1779,1838,2235,1940,2321,2418,2967,1004,1307,1390,1728,1426,1784,1862,2301,1523,1929,1967,2349,2054,2473,2523,3090,1608,2013,2103,2497,2168,2615,2643,3179,2271,2703,2834,3296,2932,3412,3644,4103,1040,1403,1504,1876,1586, 1953,2039,2490,1648,2064,2121,2582,2200,2638,2746,3264,1765,2183,2237,2695,2341,2801,2908,3451,2405,2943,3036,3553,3123,3687,3773,4493,1858,2306,2386,2849,2503,2964,3054,3606,2630,3082,3184,3726,3304,3791,3993,4710,2733,3213,3341,3897,3395,4061,4144,4890,3625,4203,4290,4854,4400,5032,5265,6084,594,772,816,1202 ,877,1221,1291,1684,886,1295,1368,1745,1437,1844,1882,2412,994,1374,1442,1911,1514,1936,2005,2415,1566,2004,2085,2545,2185,2623,2666,3177,1027,1503,1578,1917,1667,2017,2107,2616,1718,2146,2205,2676,2259,2788,2867,3381,1705,2243,2313,2783,2403,2914,2976,3554,2510,3062,3130,3685,3205,3752,3922,4655,1102,1637,1668,2132,1758,2227,2308,2753,1800,2331,2371,2899,2445,2998,3075,3677,2073,2422,2505,3028,2591,3111,3203,3736,2712,3237,3361,3884,3462,4052,4161,4828,2222,2564,2683,3166,2780,3294,3372,4003,2876,3433,3495,4092,3649,4247,4328,4982,3044,3636,3694,4292,3738,4404,4265,5092,3951,4630,4712,5306,4747,5594,5743,6254,1149,1750,1770,2396,2020,2470,2521,3055,2137,2536,2597,3150,2710,3246,3352,4014,2208,2700,2770,3255,2842,3376,3472,4113,2944,3506,3604,4224,3728,4313,4483,5127,2410,2792,2860,3470,2971,3577,3707,4271,3142,3709,3781,4462,3952,4391,4673,5336,3287,3852,4036,4634,4121,4741,4842,5500,4250,4865,4863,5705,5104,5797,5923,6643,2557,2935,3064,3714,3244,3789,3918,4527,3363,4005,4068,4722,4191,4773,4859,5577,3477,4135,4279,4830,4350,4880,5114,5807,4519,5143,5255,5947,5418,6128,6238,7027,3678,4301,4436,5119,4665,5132,5383,6011,4701,5358,5523,6202,5660,6355,6576,7343,4781,5607,5781,6420,5884,6606,6501,7441,6074,6753,6866,7735,7075,7890,8107,8672,675,827,912,1242,973,1378,1444,1865,1024,1462,1517,1909,1584,1997,2011,2607,1036,1579,1628,1990,1672,2229,2277,2729,1814,2284,2395,2880,2453,2981,3070,3719,1046,1662,1753,2254,1825,2388,2426,2959,1868,2488,2527,3084,2613,3188,3278,3800,1931,2574,2659,3222,2760,3350,3414,3967,2809,3385,3514,4133,3545,4216,4303,5286,1311,1819,1851,2447,1916,2529,2609,3159,2032,2668,2718,3315,2823,3443,3504,4026,2128,2726,2858,3405,2953,3541,3564,4170,3024,3572,3597,4323,3844,4406,4598,5347,2213,2951,2990,3591,31

09,3699,
3717,4369,3197,3842,3931,4518,4078,4656,4724,5533,3312,3989,4123,4736,4254,4820,4999,5672,4426,5021,515
1,5809,5260,5960,6165,6997,1335,1896,1999,2648,2114,2719,2840,3460,2192,2869,2961,3574,3046,3615,3657,43
58,2329,2996,3100,3669,3195,3825,3907,4505,3305,3959,4070,4696,4172,4783,4934,5545,2430,3157,3275,3927,3
420,4040,4031,4793,3480,4140,4211,4892,4378,5007,5061,5832,3613,4256,4415,5034,4509,5177,5264,6021,4625,
5324,5453,6203,5694,6380,6591,7372,2514,3333,3439,4146,3562,4245,4383,5023,3820,4424,4541,5237,4558,527
7,5409,6112,3857,4548,4620,5377,4806,5444,5628,6346,4970,5681,5773,6433,5919,6673,6774,7477,3961,4852,49
12,5554,5083,5710,5795,6541,5153,5908,6036,6740,6170,6884,7049,7773,5468,6047,6215,6907,6409,7106,7198,8
052,6552,7297,7429,8177,7600,8403,8619,9434,1432,2034,2153,2873,2315,2988,3088,3747,2357,3118,3218,3834,
3319,3941,4111,4939,2496,3283,3453,4016,3522,4237,4181,4980,3581,4281,4395,5141,4529,5204,5295,6076,276
2,3484,3583,4225,3815,4367,4441,5250,3832,4539,4586,5297,4663,5410,5495,6280,3861,4646,4764,5483,4962,56
18,5755,6451,5045,5871,5914,6696,6041,6776,6948,7703,2816,3812,3824,4514,3876,4550,4690,5430,3983,4814,4
903,5583,5011,5733,5894,6621,4413,4949,5091,5767,5164,5949,6052,6762,5420,6065,6224,6917,6418,7080,7182,
8042,4575,5175,5372,5958,5470,6193,6303,6986,5647,6369,6476,7173,6608,7308,7466,8270,5786,6565,6722,742
3,6860,7559,7692,8434,7016,7748,7881,8593,7960,8862,8897,9943,2851,3886,3939,4924,4359,4993,5056,5861,44
71,5137,5227,5988,5400,6097,6266,6960,4608,5288,5459,6139,5567,6322,6486,7149,5741,6597,6465,7250,6764,7
455,7598,8312,4972,5506,5616,6385,5822,6511,6706,7396,5937,6728,6855,7564,6932,7613,7789,8568,6176,6893,
7040,7723,7208,7907,8017,8763,7333,8152,8242,8986,8414,9113,9156,9722,5166,5630,5925,6734,6086,6829,689
5,7666,6248,7064,7117,7857,7264,7917,8187,8887,6291,7238,7407,8140,7589,8275,8301,9144,7757,8446,8538,92
46,8728,9460,9590,10280,6633,7532,7570,8376,7826,8460,8602,9302,7948,8754,8793,9564,9022,9599,9973,1053
3,8081,8953,9085,9785,9276,9854,10072,10746,9378,10128,10254,10923,10407,11070,11190,11818,1017,1284,13
39,1723,1407,1736,1887,2297,1490,1830,1950,2392,2093,2517,2579,3291,1594,1901,1987,2512,2174,2619,2814,3
328,2266,2806,2707,3426,2984,3531,3621,4297,1659,2098,2218,2690,2282,2796,2895,3447,2434,2939,3012,3542,
3210,3715,3797,4468,2533,3051,3272,3768,3321,3863,3956,4567,3421,3975,4084,4779,4157,4876,5028,5816,180
4,2111,2362,2922,2459,3003,3191,3653,2598,3284,3072,3801,3401,3903,4049,4643,2741,3261,3410,3969,3500,40
66,4130,4815,3593,4177,4319,4944,4457,5080,5222,6057,2920,3429,3549,4107,3722,4220,4388,5066,3839,4401,4
560,5162,4653,5319,5432,6249,3999,4631,4794,5367,4837,5437,5588,6415,4995,5654,5763,6537,5880,6668,6876,
7847,2023,2354,2477,3232,2655,3309,3347,4046,2824,3403,3510,4099,3600,4212,4267,5052,2978,3519,3631,423
2,3778,4380,4535,5188,3893,4537,4640,5282,4803,5415,5560,6362,3096,3696,3849,4448,3915,4545,4675,5384,40
88,4789,4849,5454,4990,5643,5718,6535,4242,4921,5069,5679,5172,5856,5896,6656,5332,5983,6177,6814,6313,6
968,7272,7853,3174,3871,4059,4697,4200,4824,4967,5668,4308,5004,5099,5803,5224,5890,6048,6771,4515,5195,
5284,5971,5441,6123,6276,7022,5542,6329,6458,7156,6578,7329,7436,8320,4670,5393,5516,6198,5688,6356,648
2,7221,5878,6521,6663,7378,6824,7463,7718,8574,6030,6702,6879,7596,6943,7796,7899,8774,7245,7971,8076,87
36,8208,8934,9194,10053,2189,2604,2701,3492,2830,3528,3665,4375,2846,3674,3809,4479,3936,4651,4706,5552,
3078,3821,3947,4760,4075,4799,4910,5555,4166,4908,5040,5750,5199,5867,5930,6653,3147,4057,4187,4771,434
5,4930,5078,5858,4433,5138,5233,5945,5315,6105,6220,6925,4409,5292,5405,6099,5540,6287,6376,7158,5701,64
94,6588,7326,6692,7409,7625,8508,3301,4288,4347,5116,4502,5270,5396,6060,4570,5428,5491,6260,5601,6405,6
512,7315,5018,5564,5691,6447,5819,6561,6690,7390,5997,6735,6901,7581,7035,7785,7918,8709,5261,5778,5955,
6639,6095,6812,6915,7729,6231,6998,7076,7838,7277,8025,8120,8882,6470,7260,7339,8078,7392,8212,8048,900
6,7661,8478,8576,9240,8612,9548,9705,10225,3390,4489,4523,5531,4935,5639,5715,6484,5124,5738,5828,6615,5995,6748,6891,7741,5238,5978,6081,6760,6189,6919,7047,7865,6331,7089,7218,7999,7380,8103,8309,9042,5550,6109,6211,7045,6366,7183,7353,8053,6603,7356,7448,8282,7663,8198,8532,9272,6800,7539,7766,8483,7874,8604,8723,9446,8028,8749,8746,9663,9018,9757,9888,10604,5769,6318,6497,7363,6745,7460,7622,8359,6903,7731,7808,8586,7956,8641,8740,9530,7051,7888,8062,8711,8148,8764,9029,9767,8350,9058,9181,9912,9360,10098,10209,10969,7317,8088,8250,9033,8522,9046,9321,9982,8564,9296,9470,10173,9614,10325,10540,11258,8653,9560,9742,10389,9850,10566,10466,11344,10042,10707,10818,11605,11013,11742,11928,12396,2377,2723,2904,3569,3032,3828,3949,4681,3138,3978,4079,4757,4197,4898,4918,5842,3167,4189,4275,4886,4355,5273,5342,6022,4593,5354,5529,6235,5613,6381,6507,7369,3185,4333,4494,5308,4617,5519,5573,6351,4685,5666,5727,6524,5852,6670,6789,7473,4791,5792,5920,6716,6070,6889,6971,7686,6134,6929,7102,7886,7145,7988,8090,9215,3703,4604,4660,5603,4769,5729,5845,6630,4956,5933,6006,6841,6160,7012,7086,7755,5110,6017,6209,6955,6342,7139,7169,7928,6442,7178,7209,8115,7528,8214,8442,9284,5247,6340,6393,7204,6559,7344,7367,8173,6681,7526,7636,8348,7821,8510,8588,9481,6836,7713,7876,8600,8034,8699,8898,9626,8238,8922,9067,9769,9187,9927,10137,10941,3744,4732,4900,5905,5088,6008,6186,7033,5211,6222,6353,7180,6472,7234,7289,8159,5426,6403,6547,7304,6679,7505,7608,8333,6826,7673,7811,8559,7931,8656,8826,9496,5578,6627,6786,7631,6981,7770,7759,8667,7057,7892,7982,8777,8183,8908,8967,9794,7232,8037,8225,8936,8337,9096,9192,9992,8471,9258,9399,10175,9651,10349,10553,11285,5706,6867,7007,7902,7167,8023,8188,8924,7498,8236,8373,9164,8397,9206,9349,10082,7545,8383,8468,9313,8682,9388,9582,10315,8868,9637,9733,10402,9884,10634,10728,11378,7676,8734,8801,9506,8994,9669,9755,10506,9069,9874,10005,10696,10140,10834,10989,11638,9414,10016,10187,10856,10378,11042,11125,11880,10517,11213,11333,11985,11486,12174,12349,12984,3928,4958,5147,6226,5407,6390,6531,7403,5464,6572,6708,7516,6849,7650,7863,8832,5677,6795,7024,7743,7113,8013,7944,8879,7190,8065,8202,9056,8361,9125,9226,10044,6072,7061,7193,8001,7492,8170,8256,9177,7514,8371,8429,9229,8519,9351,9442,10250,7553,8498,8630,9429,8858,9572,9717,10417,8949,9837,9878,10658,10009,10731,10894,11579,6147,7488,7503,8343,7571,8386,8550,9373,7704,8693,8790,9536,8912,9694,9861,10581,8223,8845,9004,9729,9080,9914,10022,10716,9363,10033 ,10196,10866,10387,11018,11112,11871,8415,9093,9310,9924,9416,10164,10273,10932,9600,10338,10441,11103,10568,11224,11367,12062,9746,10529,10680,11329,10812,11451,11571,12197,10958,11616,11734,12328,11802,12546,12573,13361,6200,7584,7648,8815,8161,8893,8962,9825,8294,9052,9153,9955,9339,10067,10237,10906,8454,9217,9404,10110,9519,10290,10452,11080,9703,10557,10430,11173,10718,11356,11484,12097,8870,9453,9570,10355,9782,10477,10667,11307,9902,10684,10808,11455,10879,11499,11653,12309,10147,10842,10980,11595,11135,11755,11850,12467,11248,11963,12040,12641,12182,12741,12773,13201,9082,9585,9890,10691,10056,10784 ,10844,11548,10220,11002,11053,11714,11186,11765,11994,12565,10262,11162,11316,11952,11476,12066,12087,12763,11625,12207,12287,12844,12438,13004,13102,13597,10593,11429,11461,12153,11689,12219,12336,12885,11791,12458,12491,13084,12671,13110,13381,13772,11905,12617,12720,13247,12865,13297,13453,13915,12946,13490,13579,14031,13685,14126,14202,14587,1303,1618,1681,2125,1760,2140,2309,2776,1856,2249,2383,2883,2543,3020,3085,3868,1978,2326,2424,3014,2635,3133,3343,3913,2738,3335,3228,4018,3537,4129,4227,4951,2051,2550,2689,3209,2755,3325,3435,4043,2928,3487,3565,4142,3784,4331,4418,5133,3039,3608,3848,4385,3905,4491,4588,5240,4012,4611,4726,5461,4801,5562,5723,6542,2215,2567,2843,3467,2954,3556,3763,4262,3107,3859,3633,4422,3985,4531,4683,5317,3270,3836,3995,4606,4094,4703,4776,5503,4199,4821,4974,5638,5121,5776,5927,6794,3464,4022,4152,4754,4340,4872,5051,5762,4464,5064,5235,5864,5328,6029,6149,6994,4637,5304,5479,6078,5525,6154,6312,7164,5690,6375,6490,7286,6613,7417,7630,8607,2466,2836,2973,3806,3172,3888,3934,4

680,335 9,3986,4104,4744,4207,4861,4920,5745,3530,4115,4238,4882,4396,5042,5206,5892,4521,5208,5314,5990,5490,61 30,6282,7108,3660,4310,4474,5112,4544,5217,5356,6094,4731,5472,5536,6173,5685,6364,6444,7284,4894,5612,5 765,6400,5873,6585,6629,7405,6044,6715,6914,7567,7054,7724,8030,8614,3743,4499,4693,5380,4848,5514,5662, 6388,4963,5700,5799,6530,5929,6623,6785,7522,5184,5898,5992,6704,6159,6863,7019,7780,6258,7071,7203,791 3,7328,8085,8197,9076,5349,6104,6230,6938,6411,7101,7228,7984,6610,7271,7411,8142,7579,8220,8480,9333,67 66,7457,7633,8357,7700,8558,8661,9529,8008,8732,8839,9491,8969,9688,9938,10777,2651,3115,3220,4086,3368, 4125,4273,5037,3388,4283,4432,5145,4566,5326,5390,6271,3640,4444,4577,5439,4714,5485,5598,6275,4810,559 6,5734,6478,5902,6599,6662,7402,3710,4692,4832,5450,5001,5620,5775,6586,5094,5840,5939,6676,6024,6843,69 62,7681,5074,6002,6117,6838,6256,7029,7119,7914,6422,7240,7338,8083,7446,8172,8385,9267,3878,4942,5002,5 818,5171,5977,6107,6797,5244,6144,6205,7006,6324,7153,7259,8072,5713,6286,6414,7192,6544,7313,7443,8154, 6731,7487,7656,8342,7793,8547,8681,9465,5968,6506,6686,7386,6833,7565,7670,8492,6976,7754,7835,8599,803 6,8786,8881,9633,7214,8021,8096,8841,8157,8975,8807,9752,8424,9235,9335,9987,9368,10287,10437,10943,397 4,5156,5194,6245,5626,6359,6441,7229,5827,6467,6554,7362,6729,7500,7646,8503,5944,6710,6820,7511,6927,76 75,7805,8627,7072,7849,7981,8759,8144,8866,9065,9790,6268,6848,6952,7803,7112,7943,8114,8814,7352,8117,8 207,9041,8425,8958,9291,10018,7552,8303,8527,9239,8636,9362,9479,10186,8789,9502,9500,10396,9765,10490, 10615,11301,6496,7059,7242,8122,7497,8218,8380,9120,7658,8494,8569,9344,8718,9398,9495,10269,7810,8651, 8825,9467,8907,9518,9776,10500,9108,9808,9926,10641,10104,10820,10928,11649,8073,8852,9012,9781,9280,97 96,10062,10703,9323,10038,10208,10889,10351,11037,11241,11922,9409,10300,10473,11098,10577,11268,11170, 12006,10766,11404,11504,12251,11694,12379,12552,12979,2864,3248,3444,4174,3588,4453,4579,5361,3701,461 5,4720,5436,4844,5584,5609,6571,3734,4834,4929,5572,5013,5980,6054,6759,5267,6066,6244,6980,6336,7127,72 52,8130,3755,4989,5161,6019,5291,6233,6293,7095,5366,6386,6453,7274,6580,7418,7541,8232,5475,6519,6652,7 468,6807,7644,7726,8448,6874,7685,7860,8649,7901,8748,8854,9964,4318,5278,5338,6326,5449,6455,6574,7375, 5649,6665,6742,7595,6897,7768,7846,8516,5812,6755,6950,7712,7084,7895,7926,8692,7186,7938,7970,8876,829 2,8977,9202,10029,5954,7082,7141,7962,7310,8102,8128,8931,7433,8290,8396,9107,8583,9268,9346,10219,7591, 8474,8638,9358,8795,9455,9650,10363,9002,9676,9819,10502,9933,10653,10851,11620,4361,5412,5586,6638,578 8,6744,6924,7791,5915,6965,7097,7940,7216,7996,8047,8918,6141,7151,7299,8061,7431,8265,8367,9090,7580,84 36,8571,9316,8695,9411,9579,10233,6300,7373,7536,8392,7737,8531,8521,9424,7816,8655,8742,9532,8943,9659, 9716,10523,7994,8797,8990,9690,9095,9845,9937,10712,9228,10004,10142,10890,10385,11060,11254,11948,642 9,7621,7762,8663,7924,8784,8948,9678,8258,9000,9136,9908,9158,9953,10093,10804,8308,9146,9223,10055,943 9,10133,10319,11026,9620,10373,10465,11109,10611,11328,11422,12034,8438,9489,9555,10245,9741,10401,104 88,11209,9821,10600,10726,11391,10855,11521,11672,12283,10158,10737,10903,11544,11089,11721,11800,1250 8,11220,11882,11996,12603,12139,12780,12943,13526,4556,5651,5851,6970,6119,7138,7279,8167,6184,7322,746 2,8279,7602,8411,8625,9584,6399,7547,7782,8505,7871,8773,8706,9631,7950,8828,8964,9806,9122,9873,9975,10 768,6809,7820,7952,8760,8252,8929,9017,9921,8277,9134,9189,9977,9278,10094,10182,10966,8314,9255,9387,1 0171,9610,10310,10449,11124,9701,10563,10606,11352,10730,11424,11581,12223,6885,8247,8264,9102,8332,91 48,9309,10118,8467,9448,9544,10275,9665,10426,10587,11282,8988,9596,9751,10459,9832,10643,10742,11412,1 0106,10756,10914,11554,11096,11699,11786,12500,9176,9843,10051,10651,10160,10878,10984,11611,10337,110 50,11147,11776,11270,11891,12026,12677,10479,11233,11375,11991,11498,12105,12214,12803,11637,12263,123 70,12924,12433,13120,13147,13863,6940,8345,8409,9568,8919,9644,9711,10552,9051,9801,9898,10679,10081,10790,10954,11591,9211,9966,10149,10830,10259,11001,11157,11754,10435,11260,11137,11845,11414,12017,12137,12707,9622,10191,10308,11065,10514,11180,11361,11971,10631,11380,11494,12109,11567,12149,12296,12904,10861,11530,11662,12240,11809,12393,12477,13051,11913,12584,12658,13210,12787,13302,13330,13718,9834,10321,10617,11385,10779,11472,11532,12193,10937,11685,11729,12348,11857,12401,12611,13140,10975,11836,11978,12575,12130,12681,12699,13322,12271,12812,12880,13396,13023,13544,13633,14078,11293,12083,12113,12759,12323,12822,12931,13433,12425,13045,13072,13614,13234,13638,13881,14231,12532,13189,13284,13761,13417,13802,13946,14357,13485,13981,14063,14461,14157,14546,14614,14947,3688,4258,4370,5105,4506,5128,5397,6089,4667,5300,5509,6240,5747,6435,6527,7560,4867,5422,5569,6425,5885,6592,6880,7615,6037,6869,6723,7744,7132,7882,8002,8846,4984,5757,5963,6697,6061,6856,7000,7775,6306,7066,7170,7897,7451,8124,8228,9048,6461,7224,7533,8191,7605,8317,8430,9166,7739,8456,8589,9405,8676,9513,9683,10507,5251,5782,6190,7041,6343,7159,7424,8043,6556,7549,7255,8233,7706,8364,8542,9250,6779,7519,7719,8451,7840,8565,8645,9450,7965,8700,8871,9591,9035,9738,9892,10747,7036,7750,7908,8620,8135,8755,8955,9723,8284,8971,9161,9828,9263,9999,10120,10938,8487,9236,9425,10046,9473,10124,10281,11093,9646,10343,10455,11205,10573,11323,11513,12339,5632,6179,6371,7481,6647,7585,7640,8539,6899,7709,7854,8609,7976,8744,8809,9706,7122,7866,8014,8767,8204,8945,9127,9858,8352,9130,9247,9957,9436,10099,10251,11043,7292,8098,8297,9026,8377,9140,9293,10063 ,8595,9417,9485,10144,9640,10333,10411,11203,8780,9565,9726,10370,9838,10547,10589,11313,10013,10674,10862,11458,10992,11597,11861,12344,7398,8326,8555,9318,8729,9461,9616,10358,8859,9656,9759,10495,9895,10583,10738,11418,9103,9863,9960,10664,10130,10815,10962,11643,10228,11007,11129,11759,11243,11908,12001,12711,9285,10073,10201,10884,10379,11038,11152,11822,10570,11191,11318,11954,11467,12021,12235,12907,10720,11358,11515,12134,11576,12301,12385,13059,11840,12441,12527,13029,12627,13175,13357,13934,5909,6567,6712,7830,6909,7877,8056,8939,6934,8068,8244,9060,8404,9260,9328,10241,7266,8260,8417,9382,8577,9430,9552,10246,8687,9549,9695,10443,9868,10559,10622,11311,7359,8552,8712,9395,8901,9573,9735,10549,9007,9802,9904,10637,9994,10796,10907,11560,8982,9970,10087,10792,10226,10970,11054,11761,10390,11163,11252,11906,11348,11980,12160,12857,7573,8835,8904,9778,9087,9944,10076,10750,9171,10114,10177,10948,10293,11085,11181,11896,9672,10256,10383,11120,10509,11229,11345,11964,10688,11386,11536,12122,11656,12292,12402,13008,9934,10470,10647,11297,10786,11456,11550,12244,10920,11621,11695,12333,11866,12484,12560,13134 ,11141,11853,11917,12529,11967,12632,12503,13222,12188,12835,12909,13391,12937,13602,13705,14043,7693,9072,9114,10216,9580,10328,10408,11154,9787,10432,10518,11275,10686,11398,11527,12255,9909,10669,10772 ,11408,10873,11556,11668,12355,11009,11707,11819,12462,11956,12548,12703,13249,10238,10801,10897,11666,11048,11787,11932,12509,11265,11934,12010,12685,12190,12619,12875,13413,11445,12089,12277,12839,12363,12933,13018,13535,12488,13039,13037,13677,13230,13743,13827,14273,10461,10997,11165,11938,11395,12020,12155,12745,11538,12246,12310,12917,12429,12959,13034,13588,11674,12376,12517,13009,12580,13052,13238,13749,12737,13263,13348,13843,13473,13962,14033,14486,11898,12536,12662,13243,12868,13254,13445,13884,12900,13428,13550,14009,13648,14103,14234,14648,12967,13610,13731,14144,13798,14252,14189,14698,13926,14335,14397,14835,14512,14906,15002,15227,6216,6749,7013,7934,7199,8271,8420,9298,7347,8462,8584,9379,8724,9537,9561,10534,7387,8715,8820,9524,8914,9947,10023,10713,9196,10035,10214,10925,10304,11061,11174,11945,7413,8888,9077,9989,9221,10203,10263,11031,9304,10356,10419,11194,10542,11325,11436,12030,9420,10484,10612,11369,10760,11525,11599,12208,10825,11564,11717,12374,11750,12453,12538,13373,8109,9208,9273,10296,9393,10422,10537,11288,9603,10625,10697,11482,10846,11633,11704,12267,9772,10709,10895,11586,1 1021,11745,11771,12410,11115,11781,11810,12556,12079,12634,12807,13420,9919,11019,11074,11803,11226,11923,11943,12598,11337,12077,12168,12735,12319,12859,12918,13557,11478,12230,12364,12928,12492,12999,13148,13655,12654,13166,13270,13750,13352,13853,13985,14470,8162,9353,9539,10598,9748,10700,10871,11654,9880,10910,11033,11783,11142,11832,11875,12588,10111,11082,11215,11887,11335,12058,12143,12722,11469,12199,12312,12895,12413,12968,13093,13565,10270,11286,11431,12164,11606,12281,12273,12975,11678,12381,12448,13061,12607,13154,13197,13765,11830,12494,12644,13177,12727,13290,13356,13891,12831,13404,13499,14010,13670,14118,14242,14663,10397,11505,11628,12387,11770, 12482,12612,13168, 12051,12652,12756,13334,12774,13366,13465,13952,12094,12765,12826,13441,12987,13493,13626,14097,13124,13662,13726,14152,13823,14289,14347,14714,12201,13027,13076,13571,13214,13681,13741,14212,13271,13815,13899,14328,13989,14408,14498,14853,13511,13907,14017,14421,14137,14529,14574,14977,14220,14626,14692,15030,14773,15122,15207,15492,8393,9606,9813,10916,10089,11071,11198,11975,10154,11237,11363,12069,11488,12179,12353,13097,10368,11440,11645,12257,11725,12473,12421,13133,11792,12519,12624,13261,12746,13309,13382,13928,10762,11683,11794,12463,12047,12597,12667,13343,12067,12754,12798,13384,12866,13467,13530,14059,12099,12849,12951,13521,13116,13619,13713,14163,13185,13791,13820,14301,13903,14348,14444,14820,10836,12042,12056,12731,12114,12767,12890,13481,12224,12994,13069,13592,13159,13697,13806,14260,12642,13107,13221,13721,13279,13845,13912,14340,13474,13920,14023,14427,14143,14516,14567,14972,12788,13288,13437,13851,13512,14003,14073,14464,13639,14111,14176,14562,14253,14631,14709,15069,13736,14227,14316,14688,14394,14752,14814,15135,14479,14841,14901,15197,14938,15298,15310,15646,10886,12124,12178,13086,12590,13143,13193,13783,12693,13257,13326,13870,13458,13942,14051,14451,12816,13375,13504,13969,13581,14083,14182,14551,13704,14247,14171,14603,14342,14704,14772,15086,13126,13538,13617,14122,13758,14195,14308,14675,13836,14320,14390,14756,14436,14779,14861,15188,13992,14413,14492,14829,14580,14913,14961,15262,14643,15021,15057,15344,15127,15386,15401,15581,13281,13627,13828,14323,13935,14376,14414,14803,14039,14506,14535,14891,14610,14918,15034,15306,14066,14596,14681,15016,14768,15073,15082,15397,14846,15140,15174,15430,15247,15501,15542,15738,14267,14738,14758,15111,14877,15145,15201,15449,14932,15258,15274,15534,15354,15545,15656,15802,14991,15331,15377,15602,15442,15620,15681,15853,15473,15697,15732,15895,15771,15926,15951,16070,313,432,457,645,488,651,727,953,530,702,763,1006,838,1077,1109,1542,581,737,781,1073,882,1136,1248,1569,934,1243,1186,1627,1353,1695,1752,2207,612,841,910,1176,941,1238,1297,1645,1029,1326,1367,1702,1492 ,1816,1867,2324,1085,1392,1530,1848,1563,1913,1975,2394,1625,1989,2063,2547,2110,2618,2728,3322,686,849,986,1314,1039,1362,1482,1773,1121,1537,1406,1871,1610,1939,2036,2449,1209,1522,1615,1986,1674,2048,2094,2577,1735,2123,2220,2670,2317,2766,2871,3515,1310,1631,1708,2082,1821,2156,2272,2756,1897,2280,2391,2826,2457,2946,3031,3672,2007,2441,2560,2979,2592,3035,3153,3803,2706,3198,3286,3901,3375,4007,4182,5020,802,982,1052,1506,1156,1554,1580,2035,1256,1611,1679,2075,1740,2149,2188,2744,1349,1685,1757,2163,1854,2265,2373,2845,1932,2374,2448,2916,2568,3017,3129,3759,1422,1803,1904,2310,1947,2380,2476,2992,2067,2555,2600,3049,2702,3190,3250,3899,2171,2652,2757,3217,2833,3354,3389,3998,2955,3455,3609,4128,3716,4259,4517,5025,1470,1919,2043,2492,2141,2585,2686,3208,2212,2713,2781,3314,2872,3384,3508,4091,2360,2848,2918,3446,3040,3567,3690,4304,3113,3729,3835,4416,3935,4564,4658,5445,2471,2999,3093,3627,3224,3756,3854,4477,3374,3889,4002,4612,4137,4679,4905,5683,3493,4039,4184,4797,4240,4975,5070,5874,4496,5131,5229,5836,5345,6025,6272,7133,891,1125,1182,1669,1261,1691,1780,2261,1272,1787,1877,2332,1962,2455,2499,3122,1411,1885,1969,2532,2055,2563,2642,3126,2116,2640,2735,3276,2853,3365,3415,3996,1451,2041,2130,2540,2239,2657,2764,3 356,2300,2812,2879,3424,2942,3552,3646,4223,2286
,2925,3008,3548,3112,3698,3771,4419,3235,3864,39
42,4561,
4030,4638,4823,5621,1548,2201,2240,2795,2350,290
9,3001,3517,2398,3027,3074,3680,3161,3795,3880,4
551,272
1,3134,3229,3827,3324,3921,4028,4622,3466,4064,4
204,4784,4316,4965,5086,5810,2902,3297,3432,3981
,3544,41
26,4215,4914,3656,4284,4353,5014,4522,5180,5268,
5975,3845,4508,4573,5231,4624,5350,5202,6090,485
6,5591,5
686,6320,5719,6624,6780,7311,1604,2340,2366,3104
,2662,3186,3249,3856,2802,3267,3331,3962,3465,40
73,4195,
4925,2884,3450,3534,4082,3618,4219,4327,5038,373
1,4363,4475,5154,4613,5254,5435,6127,3120,3557,3
638,432
5,3764,4445,4589,5209,3954,4591,4666,5413,4858,5
335,5645,6348,4116,4750,4947,5597,5046,5714,5824
,6520,51
85,5849,5846,6737,6102,6834,6963,7707,3290,3721,
3866,4596,4071,4676,4819,5486,4205,4916,4985,569
5,5118,5
746,5841,6605,4332,5060,5218,5813,5290,5865,6113
,6844,5476,6145,6259,6988,6436,7175,7296,8099,45
53,5241,
5386,6120,5636,6132,6394,7055,5674,6370,6545,725
3,6688,7412,7639,8418,5758,6635,6818,7482,6922,7
668,756
3,8517,7120,7818,7932,8810,8150,8970,9184,9736,9
97,1195,1301,1720,1381,1891,1970,2480,1445,1993,
2060,253
0,2136,2633,2647,3344,1465,2131,2194,2625,2246,2
910,2963,3488,2414,2970,3102,3661,3169,3776,3874
,4602,14
77,2231,2344,2938,2431,3095,3140,3749,2484,3206,
3257,3891,3349,4009,4106,4688,2556,3307,3408,405
0,3524,4
193,4261,4878,3576,4228,4373,5058,4408,5146,5242
,6294,1809,2421,2463,3162,2538,3259,3346,3973,26
78,3416,
3474,4153,3595,4294,4362,4938,2791,3483,3637,424
9,3741,4403,4429,5095,3823,4438,4466,5263,4740,5
352,555
8,6360,2890,3739,3786,4460,3920,4580,4600,5312,4
020,4738,4833,5473,4997,5623,5697,6555,4148,4901
,5048,57
09,5189,5800,5993,6700,5376,6013,6155,6846,6263,
7004,7212,8066,1832,2513,2634,3396,2773,3476,361
6,4314,2
862,3648,3751,4440,3847,4487,4530,5298,3026,3793
,3910,4543,4019,4717,4807,5458,4139,4868,4988,56
70,5097,
5761,5922,6570,3145,3970,4102,4827,4269,4952,494
3,5771,4336,5065,5140,5876,5322,6000,6055,6870,4
485,519
2,5364,6027,5463,6182,6269,7065,5587,6337,6474,7
256,6727,7438,7654,8449,3240,4175,4289,5072,4427
,5178,53
29,6015,4709,5374,5499,6239,5521,6284,6423,7162,
4755,5510,5582,6389,5785,6464,6657,7401,5961,671
1,6810,7
495,6958,7738,7841,8553,4870,5834,5899,6581,6079
,6743,6831,7603,6157,6947,7079,7806,7217,7953,81
23,8850,
6488,7090,7269,7979,7469,8179,8274,9128,7616,836
9,8506,9251,8677,9474,9686,10474,1956,2679,2818,
3652,30
10,3785,3895,4633,3057,3930,4044,4729,4159,4847,
5035,5928,3215,4110,4306,4927,4382,5168,5108,597
2,4449,5
220,5340,6142,5488,6206,6307,7123,3526,4341,4451
,5157,4705,5309,5391,6253,4727,5497,5547,6310,56
33,6426,
6515,7335,4762,5611,5736,6503,5951,6648,6792,751
2,6040,6910,6953,7763,7085,7844,8019,8778,3585,4
700,471
5,5467,4777,5512,5663,6449,4895,5794,5888,6611,6
004,6767,6933,7683,5362,5940,6087,6803,6167,6990
,7098,78
28,6439,7110,7280,7990,7479,8155,8259,9117,5537,
6180,6384,7001,6491,7243,7357,8057,6677,7428,753
7,8248,7
671,8381,8543,9342,6822,7628,7788,8501,7927,8633
,8768,9503,8086,8823,8959,9660,9036,9922,9958,10
961,362
9,4786,4845,5913,5301,5986,6050,6898,5421,6137,6
229,7030,6413,7147,7323,8031,5568,6296,6479,7187
,6596,73
76,7548,8221,6777,7659,7524,8327,7831,8529,8674,
9383,5964,6525,6645,7444,6859,7574,7774,8475,697
8,7794,7
921,8639,8006,8690,8864,9634,7222,7963,8112,8798
,8285,8985,9091,9827,8407,9224,9317,10040,9484,1
0167,10
204,10751,6169,6660,6966,7799,7136,7896,7966,874
3,7306,8139,8192,8932,8340,8996,9261,9948,7348,8
315,848
6,9213,8664,9347,9370,10193,8834,9514,9604,10294
,9791,10498,10626,11278,7696,8608,8644,9449,8902
,9527,9
671,10346,9024,9816,9856,10601,10077,10636,1098
6,11516,9159,10012,10143,10814,10322,10874,1108
3,11716,
10420,11132,11255,11877,11399,12013,12125,12695
,1436,1769,1837,2305,1922,2320,2502,2987,2026,24
37,2581,
3099,2745,3243,3311,4120,2152,2520,2622,3236,283
9,3360,3580,4169,2950,3571,3459,4274,3780,4392,4
492,523
6,2226,2750,2898,3440,2966,3561,3676,4300,3149,3
725,3808,4405,4035,4597,4684,5417,3263,3851,4100
,4654,41
60,4763,4862,5528,4270,4885,5003,5752,5082,5860,
6020,6851,2402,2769,3061,3706,3173,3799,4013,452

6,3332,4
112,3875,4689,4244,4802,4961,5606,3503,4087,4253,4879,4357,4979,5055,5796,4461,5101,5259,5934,5408,6075,
6223,7103,3702,4278,4412,5031,4607,5150,5333,6062,4734,5346,5522,6164,5617,6332,6450,7307,4911,5593,577
2,6379,5820,6457,6618,7476,5987,6682,6799,7599,6918,7732,7945,8921,2665,3053,3194,4060,3404,4143,4190,49
59,3596,4246,4366,5022,4470,5142,5203,6046,3772,4377,4501,5163,4662,5323,5493,6192,4792,5494,5604,6289,5
783,6430,6587,7419,3906,4574,4746,5399,4816,5505,5646,6396,5008,5766,5831,6475,5982,6672,6752,7597,5174,
5910,6064,6707,6175,6892,6935,7722,6345,7025,7225,7880,7366,8038,8347,8926,3990,4772,4971,5671,5129,580
6,5957,6695,5246,5998,6096,6839,6225,6928,7092,7836,5469,6197,6290,7015,6462,7172,7332,8091,6564,7381,75
17,8226,7641,8402,8512,9389,5641,6406,6538,7247,6718,7414,7542,8300,6916,7586,7728,8457,7889,8537,8792,9
639,7074,7769,7947,8671,8016,8872,8978,9839,8322,9045,9154,9798,9282,9995,10242,11066,2857,3338,3452,43
49,3603,4387,4538,5318,3624,4547,4698,5429,4839,5615,5680,6577,3883,4711,4851,5732,4992,5777,5895,6582,5
090,5893,6032,6787,6201,6904,6972,7720,3958,4969,5113,5742,5285,5918,6073,6894,5382,6138,6234,6985,6328,
7155,7275,7998,5357,6302,6417,7148,6562,7342,7435,8229,6733,7555,7651,8399,7758,8488,8702,9574,4132,522
6,5287,6114,5455,6277,6408,7105,5532,6446,6510,7318,6631,7465,7576,8387,6010,6593,6724,7507,6854,7624,77
56,8469,7039,7800,7972,8657,8106,8861,8997,9770,6265,6815,6996,7702,7144,7878,7987,8803,7288,8069,8151,8
915,8353,9099,9197,9942,7529,8336,8413,9155,8470,9286,9124,10059,8737,9545,9641,10289,9679,10584,10734,
11227,4234,5440,5480,6551,5924,6667,6750,7544,6124,6773,6865,7677,7037,7814,7959,8816,6241,7021,7128,78
25,7237,7991,8119,8940,7383,8165,8298,9070,8459,9180,9377,10097,6575,7160,7263,8118,7425,8261,8431,9131,
7665,8433,8523,9354,8739,9271,9598,10317,7867,8615,8842,9550,8950,9673,9784,10485,9104,9812,9809,10693,
10071,10787,10908,11582,6804,7371,7558,8440,7812,8534,8698,9431,7974,8804,8883,9652,9031,9707,9803,1056
5,8125,8966,9141,9773,9219,9829,10083,10797,9421,10115,10229,10933,10403,11105,11212,11919,8389,9167,93
24,10090,9589,10101,10364,10993,9628,10339,10510,11175,10649,11319,11522,12184,9718,10595,10771,11382,
10869,11549,11454,12268,11055,11680,11777,12505,11961,12628,12795,13211,3081,3479,3684,4435,3831,4721,4
853,5653,3950,4889,4998,5730,5123,5881,5904,6881,3982,5115,5213,5869,5294,6279,6354,7067,5553,6365,6549,
7293,6642,7440,7569,8445,4004,5274,5446,6321,5579,6540,6602,7406,5657,6693,6761,7588,6888,7734,7856,854
8,5768,6828,6959,7784,7115,7958,8041,8762,7181,8003,8176,8965,8216,9061,9169,10264,4583,5563,5627,6632,5
740,6763,6883,7691,5946,6974,7048,7909,7207,8080,8163,8831,6108,7060,7261,8026,7395,8211,8241,9008,7502,
8253,8287,9191,8603,9288,9509,10329,6250,7393,7454,8281,7623,8421,8443,9245,7747,8601,8713,9418,8896,95
76,9654,10519,7903,8788,8952,9668,9109,9760,9961,10660,9312,9983,10125,10799,10234,10947,11139,11892,46
29,5704,5883,6944,6083,7050,7235,8104,6212,7276,7408,8255,7531,8311,8362,9230,6445,7464,7610,8375,7745,8
580,8683,9403,7891,8750,8886,9624,9010,9721,9887,10532,6607,7688,7852,8708,8051,8847,8836,9731,8131,897
2,9055,9841,9256,9969,10024,10821,8310,9112,9301,9997,9407,10153,10239,11003,9540,10305,10439,11177,106
83,11341,11535,12209,6739,7935,8075,8981,8239,9097,9264,9984,8573,9311,9445,10210,9469,10253,10391,1109
2,8621,9456,9535,10359,9745,10429,10618,11309,9928,10670,10763,11394,10904,11607,11700,12297,8753,9797,
9864,10543,10047,10698,10785,11489,10127,10893,11017,11669,11143,11795,11939,12535,10454,11027,11189,1
1817,11370,11987,12065,12750,11501,12145,12258,12846,12398,13015,13174,13732,4829,5948,6150,7281,6419,
7452,7594,8482,6485,7635,7776,8592,7916,8727,8937,9893,6705,7862,8093,8818,8186,9084,9021,9939,8266,914
3,9275,10112,9433,10178,10276,11057,7116,8136,8269,9073,8567,9242,9329,10224,8590,9443,9498,10279,9586,
10393,10481,11250,8629,9563,9697,10468,9916,10608,10745,11409,10008,10858,10898,11629,11022,11703,1185
2,12478,7194,8563,8578,9413,8646,9459,9617,10415,8781,9754,9853,10571,9972,10721,10880,11562,9299,9905, 10057,10757,10138,10934,11034,11690,10406,11045,11199,11827,11381,11965,12052,12743,9486,10150,10354,10944,10456,11166,11271,11884,10638,11332,11432,12043,11551,12156,12289,12916,10774,11511,11652,12254,11772,12361,12470,13040,11909,12515,12620,13155,12682,13344,13369,14057,7249,8659,8725,9877,9232,9954,10019,10847,9364,10108,10199,10971,10381,11079,11238,11862,9520,10266,10444,11116,10556,11289,11441,12022,10732,11539,11420,12110,11691,12279,12397,12948,9930,10491,10607,11346,10811,11463,11639,12231,10922,11657,11768,12365,11839,12409,12547,13135,11148,11804,11930,12495,12073,12640,12723,13276,12176,12827,12896,13429,13024,13519,13547,13917,10139,10621,10911,11663,11069,11746,11806,12449,11222,11951,11998,12599,12121,12649,12853,13363,11262,12100,12241,12818,12388,12919,12939,13540,12524,13048,13113,13607,13250,13748,13833,14258,11573,12340,12371,12995,12577,13058,13163,13645,12673,13268,13298,13816,13455,13840,14074,14405,12775,13410,13500,13959,13628,14000,14134,14527,13694,14168,14243,14623,14332,14702,14765,15080,1796,2181,2257,2786,2352,2804,3002,3539,2468,2930,3086,3663,3273,3818,3892,4767,2611,3022, 3136,3810,3379,3945,4186,4812,3498,4176,4055,4928,4398,5054,5159,5942,2698,3281,3437,4034,3518,4164,4286,4954,3712,4343,4431,5067,4669,5271,5365,6133,3837,4478,4745,5330,4804,5442,5549,6243,4922,5571,5699,6481,5779,6589,6757,7606,2893,3299,3620,4321,3742,4420,4649,5197,3916,4758,4503,5370,4897,5489,5655,6330,4096,4730,4907,5565,5016,5676,5749,6522,5125,5802,5966,6666,6121,6813,6967,7861,4317,4932,5076,5725,5280, 5854,6045,6798,5414,6058,6236,6902,6341,7073,7196,8063,5599,6316,6499,7125,6546,7202,7365,8235,6720,7434,7551,8360,7674,8495,8707,9675,3182,3610,3766,4694,3987,4788,4835,5652,4201,4899,5027,5716,5135,5843,5906,6783,4389,5039,5170,5866,5341,6034,6208,6930,5477,6210,6327,7032,6509,7177,7337,8181,4533,5248,5425,6110,5504,6219,6367,7143,5703,6493,6558,7219,6714,7421,7504,8358,5877,6641,6801,7461,6913,7647,7690,8484, 7087,7783,7986,8642,8127,8799,9106,9681,4628,5451,5667,6391,5830,6533,6689,7449,5953,6732,6835,7593,6969,7684,7851,8598,6187,6937,7034,7771,7206,7929,8089,8855,7316,8145,8280,8991,8401,9165,9270,10134,6361,7154,7287,8010,7471,8175,8305,9057,7672,8346,8491,9214,8652,9297,9547,10375,7833,8530,8710,9428,8775,9623,9727,10564,9079,9795,9899,10527,10027,10715,10957,11740,3399,3925,4047,5005,4209,5050,5210,6028,4230, 5221,5381,6146,5527,6339,6401,7327,4512,5394,5539,6459,5687,6505,6628,7331,5790,6626,6769,7538,6941,7660,7727,8481,4592,5665,5815,6471,5994,6650,6811,7649,6093,6877,6979,7742,7070,7912,8033,8758,6068,7044,7166,7905,7314,8101,8195,8993,7485,8318,8412,9162,8520,9244,9458,10311,4778,5931,5996,6853,6174,7020,7157, 7864,6246,7191,7258,8074,7377,8224,8335,9149,6746,7341,7475,8268,7609,8384,8518,9225,7797,8562,8733,9412,8869,9612,9744,10503,7010,7568,7753,8465,7900,8640,8747,9557,8046,8830,8910,9667,9111,9848,9941,10668, 8293,9094,9174,9901,9227,10030,9871,10782,9492,10284,10377,10999,10412,11284,11427,11894,4884,6158,6196,7303,6654,7416,7501,8307,6864,7525,7619,8439,7795,8575,8722,9569,6984,7779,7885,8587,8000,8752,8880,9693,8147,8923,9054,9822,9216,9925,10123,10819,7325,7915,8024,8878,8185,9020,9190,9876,8427,9193,9281,10096,9494,10017,10335,11029,8628,9371,9594,10288,9702,10405,10516,11188,9852,10541,10538,11388,10795,11475,11592,12226,7557,8133,8321,9200,8572,9294,9454,10172,8735,9559,9635,10386,9780,10438,10531,11267,8885,9715,9886,10505,9968,10555,10805,11483,10163,10833,10946,11612,11110,11779,11881,12544,9151,9911,10065,10810,10326,10823,11075,11677,10366,11051,11211,11846,11343,11982,12171,12790,10450,11295,11462,12038,11559,12194,12108,12864,11730,12317,12414,13082,12582,13198,13351,13728,3642,4074,4296,5098,4455,5403,5541,6374,4581,5575,5692,6456,5826,6614,6637,7634,4618,5817,5917,6601,6005,7023,7099,7824,6273,7111,7301,8050,7389,8200,8330,9205,4641,5981,6163,7062,6301,7290,7350,8169,6378,7447,7513,8349,7643,8497,8617,9 307,6495,7582,7716,8545,7873,8720,8802,9516,7941,8761,8935,9713,8980,9811,9913,10976,5258,6285,6350,737 9,6469,7515,7637,8455,6678,7730,7807,8670,7968,8844,8920,9583,6847,7819,8022,8787,8160,8974,9005,9753,82 63,9014,9044,9936,9361,10032,10249,11041,6995,8158,8213,9039,8382,9179,9203,9993,8509,9359,9468,10161,9 648,10313,10388,11221,8665,9542,9704,10400,9859,10493,10682,11355,10054,10704,10841,11485,10951,11626, 11813,12520,5303,6428,6616,7701,6823,7809,7997,8867,6954,8035,8171,9016,8295,9068,9123,9978,7189,8222,8 370,9138,8507,9338,9440,10148,8654,9504,9638,10361,9756,10453,10614,11236,7354,8452,8613,9464,8812,9597 19588,10463,8891,9720,9805,10567,10002,10692,10744,11507,9066,9862,10043,10717,10152,10867,10955,11686, 10278,11016,11145,11848,11379,12003,12183,12814,7490,8697,8838,9730,9003,9846,10007,10706,9332,10052,1 0185,10929,10206,10968,11099,11766,9376,10194,10274,11068,10478,11136,11314,11974,10654,11365,11453,12 050,11589,12253,12334,12891,9507,10525,10591,11245,10770,11393,11473,12141,10843,11580,11698,12308,118 16,12427,12562,13111,11159,11708,11860,12447,12028,12605,12680,13311,12151,12752,12855,13399,12982,135 53,13693,14194,5517,6680,6887,8040,7168,8210,8355,9238,7230,8395,8536,9350,8679,9482,9691,10620,7459,86 24,8857,9571,8947,9836,9768,10665,9027,9889,10021,10831,10174,10892,10987,11732,7875,8895,9030,9824,932 6,9990,10070,10942,9348,10183,10236,10990,10323,11101,11184,11915,9385,10302,10428,11172,10645,11305,11 439,12064,10729,11546,11584,12276,11702,12337,12480,13062,7954,9322,9336,10157,9402,10197,10353,11122, 9534,10487,10580,11273,10695,11416,11568,12206,10041,10633,10780,11448,10852,11614,11713,12324,11113,1 1723,11868,12455,12036,12586,12668,13305,10223,10864,11064,11623,11161,11838,11935,12512,11331,11995,1 2086,12661,12196,12762,12883,13461,11465,12163,12295,12852,12408,12954,13055,13569,12534,13092,13192,1 3676,13245,13850,13871,14482,8012,9415,9480,10605,9980,10677,10740,11534,10107,10828,10919,11651,11091 ,11752,11904,12490,10260,10978,11150,11790,11259,11950,12095,12639,11425,12186,12075,1

2718,12326,12873, 12980,13488,10656,11195,11303,12008,11497,12116,12284,12834,11604,12299,12405,12957,12468,12993,13122, 13660,11823,12434,12555,13074,12687,13209,13287,13785,12783,13380,13444,13924,13559,14006,14029,14360, 10854,11317,11594,12304,11743,12384,12436,13036,11889,12574,12615,13173,12730,13216,13405,13866,11926, 12709,12841,13371,12973,13463,13479,14021,13099,13577,13642,14086,13764,14209,14285,14660,12217,12936, 12962,13537,13151,13587,13682,14117,13236,13779,13804,14272,13949,14290,14496,14789,13332,13906,13991, 14396,14101,14433,14553,14893,14165,14579,14647,14976,14724,15044,15099,15366,4565,5193,5313,6103,5460 ,6129,6410,7137,5637,6311,6529,7298,6784,7496,7590,8635,5850,6440,6598,7486,6923,7655,7949,8691,7081,793 7,7790,8819,8206,8960,9075,9907,5976,6793,7005,7764,7107,7923,8071,8851,7361,8141,8243,8976,8526,9201,93 03,10103,7521,8302,8610,9266,8680,9386,9499,10213,8813,9523,9655,10446,9740,10551,10711,11491,6255,6819 ,7239,8113,7397,8231,8502,9119,7620,8626,8331,9308,8783,9435,9609,10299,7845,8594,8794,9517,8917,9630,97 10,10489,9040,9762,9932,10628,10092,10767,10913,11718,8108,8824,8987,9687,9210,9818,10014,10753,9356,10 028,10207,10850,10309,11011,11123,11890,9554,10286,10464,11059,10512,11128,11279,12033,10678,11338,114 44,12138,11555,12248,12422,13165,6661,7227,7430,8557,7711,8660,8717,9607,7969,8785,8928,9677,9050,9807, 9872,10736,8196,8942,9086,9831,9277,10003,10180,10877,9423,10181,10297,10973,10475,11106,11251,11988,8 366,9175,9367,10080,9451,10190,10336,11077,9661,10458,10522,11146,10673,11327,11403,12136,9842,10602,1 0755,11362,10860,11529,11569,12239,11025,11647,11825,12369,11942,12497,12734,13170,8476,9397,9621,1036 2,9792,10499,10650,11351,9918,10689,10789,11480,10915,11563,11710,12331,10159,10883,10974,11636,11133,1 1775,11912,12539,11232,11957,12070,12645,12172,12779,12861,13494,10331,11086,11206,11842,11372,11983,1 2091,12698,11553,12127,12243,12819,12378,12879,13071,13664,11693,12280,12424,12978,12476,13128,13204,1 3792,12714,13253,13328,13768,13419,13893,14054,14543,6949,7629,7781,8906,7980,8954,9133,9998,80

07,9145,
9319,10117,9476,10307,10372,11242,8341,9334,948
8,10425,9643,10469,10588,11246,9750,10586,10723,
11434,1
0888,11541,11600,12237,8435,9619,9775,10436,996
3,10610,10765,11531,10061,10829,10924,11610,110
06,11758 ,11864,12461,10037,10983,11095,11753,11
230,11921,12000,12647,11384,12102,12180,12777,1
2272,12842,13002 ,13621,8648,9897,9965,10806,101
45,10963,11088,11720,10218,11119,11179,11900,11
291,12025,12118,12768,107
02,11256,11376,12060,11493,12159,12270,12829,11
661,12305,12442,12969,12551,13119,13217,13751,1
0953,114
59,11619,12222,11749,12367,12452,13078,11874,12
522,12583,13161,12739,13293,13359,13862,12080,1
2726,127
86,13329,12830,13422,13308,13938,13031,13600,13
665,14082,13688,14262,14351,14633,8770,10129,10
168,1121
9,10616,11322,11401,12093,10816,11421,11503,122
02,11659,12315,12432,13087,10930,11642,11737,12
322,1183
5,12456,12559,13180,11959,12594,12696,13272,128
21,13347,13484,13961,11240,11763,11856,12558,11
992,1266
9,12800,13313,12192,12802,12869,13469,13033,134
12,13637,14099,12357,12940,13105,13603,13186,13
683,1376
0,14200,13295,13776,13774,14326,13945,14379,144
52,14822,11449,11947,12104,12806,12313,12877,12
998,1352
3,12444,13079,13137,13671,13241,13707,13770,142
51,12563,13196,13319,13753,13377,13786,13953,14
384,1351
6,13973,14046,14466,14154,14564,14625,14999,127
70,13337,13448,13957,13632,13965,14129,14501,13
657,1411
2,14215,14604,14298,14683,14792,15129,13715,142
69,14370,14716,14430,14804,14755,15167,14537,14
874,1492
6,15281,15020,15337,15410,15586,7270,7815,8082,9
011,8276,9343,9490,10342,8423,9528,9649,10423,97
86,1057
4,10597,11518,8466,9777,9882,10561,9974,10965,11
036,11687,10244,11047,11217,11878,11300,12005,1
2112,128
11,8493,9950,10135,11000,10271,11208,11264,1197
7,10347,11349,11411,12129,11524,12250,12347,128
88,10460,
11471,11590,12291,11727,12431,12499,13050,11785
,12465,12602,13195,12636,13265,13339,14068,9185,
10255,1
0318,11292,10434,11413,11520,12213,10640,11602,
11671,12394,11808,12531,12592,13096,10800,11682
,11854,1
2486,11970,12631,12657,13224,12055,12664,12689,
13355,12932,13424,13574,14106,10939,11968,12016
,12684,1
2158,12792,12809,13395,12262,12930,13011,13514,
13146,13623,13673,14221,12390,13068,13188,13680
,13299,1
3745,13873,14304,13440,13886,13978,14386,14049,
14474,14583,14984,9234,10395,10576,11577,10776,
11673,11
833,12549,10900,11865,11979,12666,12082,12706,1
2747,13385,11118,12024,12146,12758,12260,12913,
12988,13
503,12380,13042,13139,13654,13226,13717,13826,1
4230,11269,12211,12343,13007,12507,13108,13100,
13724,12
568,13199,13260,13794,13402,13878,13913,14400,1
2705,13301,13432,13895,13507,13997,14052,14507,
13595,14
092,14175,14606,14319,14696,14797,15141,11390,1
2416,12526,13206,12655,13291,13407,13887,12906,
13439,13
534,14034,13549,14062,14146,14558,12944,13541,1
3591,14124,13735,14170,14280,14678,13854,14310,
14366,14
721,14450,14836,14884,15181,13044,13767,13809,1
4237,13930,14329,14378,14775,13980,14443,14515,
14869,14
585,14935,15009,15294,14183,14521,14613,14946,1
4711,15032,15072,15392,14781,15108,15162,15433,
15229,15
506,15572,15789,9466,10642,10838,11869,11097,12
014,12133,12838,11156,12167,12285,12923,12400,1
3022,131
78,13830,11360,12352,12541,13089,12610,13283,13
233,13860,12674,13321,13416,13971,13525,14012,1
4075,145
39,11728,12571,12676,13274,12903,13393,13451,14
042,12921,13532,13567,14077,13630,14148,14198,1
4645,129
50,13613,13700,14191,13847,14276,14356,14729,13
902,14423,14447,14849,14518,14886,14963,15268,1
1797,128
99,12911,13510,12963,13543,13650,14161,13064,13
740,13801,14255,13880,14344,14437,14811,13430,1
3838,139
36,14363,13987,14467,14525,14879,14156,14532,14
618,14951,14715,15022,15064,15389,13560,13995,1
4121,144
72,14184,14599,14655,14980,14291,14691,14741,15
060,14805,15113,15177,15462,14372,14786,14860,1
5160,149
23,15213,15265,15515,14993,15285,15334,15564,15
359,15640,15651,15902,11844,12971,13020,13819,1
3387,138
69,13910,14416,13475,13968,14026,14487,14140,14
550,14638,14967,13582,14070,14178,14569,14246,1
4665,147
46,15048,14349,14799,14735,15092,14880,15172,15
228,15475,13856,14204,14275,14699,14393,14761,1
4854,151

51,14460,14863,14921,15215,14957,15234,15299,15556,14589,14939,15005,15276,15076,15343,15379,15614,151
25,15423,15454,15672,15509,15708,15718,15855,13988,14282,14454,14866,14545,14908,14941,15253,14630,150
15,15036,15323,15097,15347,15436,15649,14651,15088,15155,15419,15224,15463,15471,15715,15289,15519,155
47,15742,15604,15795,15826,15970,14817,15203,15218,15497,15312,15523,15567,15756,15356,15611,15621,158
20,15683,15828,15907,16016,15402,15665,15701,15868,15749,15883,15929,16051,15775,15940,15965,16080,159
93,16103,16121,16201,2292,2736,2825,3422,2933,3441,3667,4260,3065,3586,3760,4393,3963,4562,4644,5580,32
25,3689,3813,4554,4080,4699,4960,5634,4213,4948,4817,5753,5190,5886,5999,6816,3323,3971,4149,4795,4235,4
936,5071,5784,4450,5130,5225,5900,5481,6115,6213,7014,4584,5275,5556,6181,5624,6297,6407,7129,5748,6431,
6563,7370,6649,7483,7652,8511,3543,3991,4348,5106,4481,5214,5456,6038,4668,5570,5302,6217,5720,6344,651
6,7213,4869,5543,5731,6427,5847,6539,6619,7415,5965,6671,6840,7561,7002,7710,7868,8765,5102,5759,5911,65
94,6125,6725,6920,7694,6264,6936,7124,7801,7226,7977,8100,8973,6463,7200,7388,8027,7439,8105,8272,9142,7
617,8338,8458,9265,8581,9394,9601,10544,3865,4337,4507,5511,4751,5605,5658,6513,4976,5721,5859,6583,597
3,6713,6781,7678,5181,5870,6009,6738,6191,6911,7091,7832,6333,7093,7210,7933,7399,8079,8240,9083,5334,60
91,6278,6991,6357,7104,7257,8044,6568,7382,7453,8126,7611,8328,8408,9262,6751,7534,7697,8365,7813,8554,8
596,9384,7992,8688,8889,9541,9032,9696,9996,10548,5433,6308,6528,7282,6698,7426,7587,8354,6827,7626,773
3,8499,7869,8591,8756,9497,7068,7837,7936,8678,8110,8837,8998,9747,8217,9047,9182,9879,9305,10048,10155,
10981,7248,8054,8189,8913,8374,9078,9207,9949,8579,9248,9390,10100,9551,10179,10421,11214,8738,9432,960
5,10306,9674,10496,10594,11396,9971,10661,10761,11359,10881,11537,11762,12493,4101,4677,4808,5837,4986,
5882,6051,6905,5009,6063,6227,7026,6382,7223,7294,8230,5310,6242,6395,7349,6550,7394,7520,8234,6658,751
8,7664,8444,7842,8566,8631,9380,5398,6526,6683,7360,6871,7543,7708,8556,6973,7777,7879,8647,7973,8817,89
38,9653,6945,7946,8067,8811,8215,9009,9098,9881,8388,9218,9314,10045,9422,10131,10334,11153,5592,6805,6
872,7751,7052,7919,8058,8769,7134,8094,8164,8983,8286,9132,9237,10034,7642,8245,8378,9172,8513,9289,941
9,10113,8703,9462,9627,10291,9761,10486,10613,11334,7910,8472,8658,9365,8805,9538,9642,10431,8951,9724,
9804,10535,10000,10710,10802,11490,9195,9985,10058,10764,10116,10885,10733,11598,10369,11126,11216,118
05,11249,12068,12200,12633,5707,7038,7077,8205,7550,8323,8405,9209,7760,8432,8524,9340,8701,9475,9618,1
0442,7883,8684,8791,9487,8903,9647,9774,10560,9049,9817,9945,10685,10102,10788,10972,11630,8227,8821,89
27,9771,9088,9910,10074,10739,9330,10078,10165,10949,10371,10870,11176,11831,9525,10252,10467,11130,10
569,11244,11347,11981,10714,11371,11368,12165,11608,12247,12354,12938,8463,9037,9220,10084,9471,10176,
10330,11020,9629,10433,10508,11225,10648,11276,11364,12053,9779,10585,10748,11336,10826,11387,11617,12
256,11010,11646,11751,12375,11907,12528,12621,13223,10036,10773,10921,11622,11167,11634,11872,12430,11
204,11851,12002,12589,12126,12712,12886,13446,11287,12078,12232,12766,12320,12908,12828,13513,12483,13
019,13103,13706,13258,13807,13943,14274,4371,4840,5081,5935,5252,6251,6397,7262,5387,6437,6557,7345,669
4,7506,7530,8540,5423,6684,6790,7493,6882,7922,8004,8730,7161,8015,8203,8956,8299,9105,9231,10091,5447,6
857,7042,7967,7184,8193,8254,9071,7267,8351,8419,9252,8549,9396,9515,10188,7384,8489,8622,9444,8779,961
5,9698,10392,8848,9657,9830,10582,9869,10675,10775,11782,6100,7171,7236,8288,7358,8422,8544,9355,7575,8
634,8714,9566,8873,9737,9814,10457,7746,8726,8925,9684,9062,9865,9894,10623,9168,9903,9935,10798,10243,
10887,11094,11841,7893,9059,9118,9929,9287,10064,10088,10848,9408,10240,10344,11008,10520,11155,11228,1
2011,9562,10416,10572,11239,10719,11324,11506,12135,10912,11526,11655,12259,11756,12389,12557,13202,61
51,7319,7508,8605,7721,8716,8899,9758,7855,8941,9074,9906,9198,9962,10010,10835,8092,9129,9274,1

0025,94
06,10217,10316,10994,9553,10380,10511,11200,106
27,11290,11442,12023,8262,9352,9510,10340,9708,1
0471,10
462,11298,9783,10590,10671,11400,10857,11512,11
565,12278,9959,10722,10899,11540,10998,11681,11
760,1243
9,11121,11820,11940,12591,12157,12732,12897,134
66,8394,9592,9732,10596,9891,10708,10863,11528,1
0211,10
909,11035,11735,11056,11773,11897,12516,10257,1
1044,11117,11867,11310,11931,12098,12704,11477,
12144,122
25,12776,12350,12960,13038,13539,10382,11357,11
419,12031,11587,12169,12245,12858,11658,12341,1
2450,130
10,12561,13117,13239,13733,11953,12459,12600,13
136,12755,13280,13345,13908,12867,13414,13505,1
3986,136
20,14119,14244,14676,6372,7577,7786,8946,8070,91
15,9257,10126,8137,9300,9437,10230,9575,10360,10
558,114
46,8363,9521,9749,10445,9840,10699,10639,11487,9
915,10752,10875,11644,11023,11705,11793,12485,8
782,978
8,9917,10687,10205,10845,10926,11747,10227,1103
2,11084,11796,11164,11899,11976,12653,10265,111
44,11266,
11966,11468,12090,12210,12789,11552,12311,12345
,12976,12454,13041,13167,13686,8860,10200,10215,
11004,1
0282,11046,11192,11918,10409,11320,11410,12057,
11517,12189,12329,12920,10896,11457,11596,12220
,11667,1
2377,12464,13028,11910,12474,12608,13144,12764,
13262,13335,13900,11072,11679,11863,12386,11955
,12581,1
2672,13194,12115,12724,12808,13327,12910,13421,
13531,14040,12236,12876,12996,13501,13098,13589
,13678,1
4138,13215,13714,13799,14228,13852,14377,14398,
14919,8916,10295,10357,11433,10837,11500,11561,
12302,10
959,11640,11726,12411,11888,12504,12643,13176,1
1104,11784,11944,12537,12044,12686,12817,13310,
12198,12
901,12799,13383,13030,13522,13618,14067,11479,1
1986,12088,12736,12269,12836,12985,13482,12366,
13000,13
094,13593,13156,13629,13742,14213,12566,13125,1
3231,13698,13353,13817,13885,14324,13438,13970,
14024,14
445,14127,14513,14536,14815,11670,12101,12356,1
3005,12496,13077,13127,13663,12629,13251,13289,
13784,13
392,13824,13993,14391,12663,13374,13491,13963,1
3611,14044,14060,14530,13722,14145,14196,14581,
14302,14
689,14753,15070,12929,13572,13598,14104,13766,1
4153,14235,14611,13844,14317,14341,14739,14465,
14759,14
933,15175,13927,14428,14499,14847,14597,14878,1
4978,15263,14649,15003,15058,15332,15123,15387,
15431,15
647,5369,6033,6162,6983,6315,7009,7302,8039,6498
,7195,7420,8199,7679,8400,8496,9533,6719,7330,74
89,8390,
7823,8561,8856,9587,7985,8843,8696,9714,9110,985
1,9967,10769,6852,7689,7904,8669,8011,8829,8979,
9743,82
67,9043,9150,9866,9427,10085,10184,10956,8426,92
04,9508,10151,9577,10267,10376,11063,9709,10399,
10526,1
1283,10609,11383,11533,12264,7142,7715,8146,901
9,8306,9137,9401,10006,8525,9522,9233,10189,9680
,10312,1
0482,11140,8751,9493,9692,10394,9810,10504,1057
9,11321,9931,10632,10794,11452,10945,11585,1172
2,12469, 9015,9719,9875,10554,10095,10681,10868,
11572,10235,10882,11058,11665,
11151,11815,11920,12630,10427, 111
27,11299,11859,11342,11925,12063,12761,11502,12
120,12216,12856,12318,12956,13112,13778,7556,81
32,8334,
9457,8616,9558,9611,10480,8874,9682,9823,10545,9
940,10672,10735,11558,9100,9835,9979,10694,1016
2,10859,
11028,11692,10301,11030,11138,11778,11308,11903
,12037,12717,9269,10060,10248,10935,10327,11040,
11178,1
1873,10530,11294,11354,11941,11496,12111,12177,
12854,10705,11430,11574,12142,11676,12298,12330
,12949,1
1828,12407,12567,13067,12679,13182,13398,13781,
9375,10277,10494,11201,10659,11330,11474,12132,
10781,11
510,11603,12252,11724,12325,12460,13035,11005,1
1697,11780,12399,11929,12525,12651,13219,12019,
12691,12
794,13315,12887,13436,13509,14072,11171,11883,1
1997,12585,12150,12713,12813,13364,12316,12845,
12953,13
471,13073,13529,13695,14217,12446,12981,13114,1
3616,13164,13747,13812,14331,13379,13859,13923,
14307,14
005,14418,14556,14969,7850,8535,8685,9799,8884,9
847,10020,10853,8909,10031,10198,10967,10352,11
149,112
10,12029,9243,10212,10365,11263,10515,11304,114
17,12032,10619,11415,11545,12205,11701,12307,12
360,1294
7,9337,10492,10644,11274,10822,11438,11583,1230
0,10918,11641,11731,12373,11812,12511,12604,131
50,10891,
11789,11893,12506,12018,12660,12729,13316,12162
,12823,12894,13434,12974,13492,13636,14180,9546,10758,1 0824,11618,10991,11767,11885,12471,11067,11916, 11973,12638,12074,12753,12837,13426,11523,12041 ,12154,1 2785,12266,12874,12972,13478,12419,13006,13131, 13606,13228,13739,13825,14293,11757,12229,12383 ,12935,1 2502,13066,13142,13702,12614,13203,13259,13773, 13401,13890,13951,14389,12804,13390,13443,13925 ,13480,1 4007,13905,14457,13659,14164,14218,14578,14240, 14731,14808,15045,9666,10977,11015,12009,11443, 12107,12 175,12815,11627,12195,12275,12915,12418,13016,1 3123,13710,11736,12404,12489,13026,12578,13145, 13237,13 789,12692,13269,13362,13875,13472,13941,14065,1 4476,12027,12514,12596,13235,12721,13336,13454, 13909,12 905,13456,13518,14048,13661,13999,14193,14594,1 3057,13576,13727,14167,13795,14236,14299,14682, 13892,14 315,14313,14788,14463,14833,14894,15205,12221,1 2683,12825,13460,13014,13527,13635,14094,13132, 13703,13 755,14224,13849,14257,14309,14723,13240,13805,1 3916,14294,13967,14325,14469,14838,14089,14484, 14549,14 904,14640,14989,15039,15350,13427,13932,14028,1 4471,14188,14477,14621,14937,14210,14608,14695, 15024,14 766,15090,15179,15456,14264,14736,14826,15116,1 4876,15190,15149,15486,14964,15245,15291,15577, 15365,15 622,15680,15822,8174,8721,8992,9900,9178,10222,1 0367,11183,9325,10404,10521,11261,10655,11405,1 1426,12 288,9366,10646,10743,11392,10832,11769,11837,12 440,11090,11847,12007,12618,12085,12733,12833,1 3464,939 1,10809,10982,11807,11114,11999,12049,12708,111 87,12131,12185,12847,12294,12958,13049,13536,11 296,1224 2,12351,12992,12479,13121,13184,13675,12533,131 53,13278,13803,13307,13868,13933,14565,10069,11 100,1116 0,12076,11272,12187,12290,12927,11464,12362,124 26,13085,12554,13212,13267,13720,11613,12435,12 595,1317 2,12701,13304,13324,13832,12782,13331,13354,139 48,13570,14008,14142,14601,11744,12700,12744,13 350,1287 2,13447,13462,13984,12966,13568,13644,14088,137 63,14181,14225,14701,13081,13692,13796,14233,13 896,1428 7,14399,14771,14022,14411,14489,14839,14552,149 12,15007,15340,10122,11235,11406,12338,11593,12 428,1257 6,13227,11712,12606,12710,13333,12805,13372,134 09,13975,11914,12751,12863,13418,12965,13556,13 625,1408 0,13075,13667,13757,14208,13834,14266,14359,147 08,12054,12925,13047,13641,13191,13730,13723,14 271,1324 4,13808,13865,14333,13990,14404,14435,14851,133 70,13898,14015,14419,14081,14505,14555,14943,14 160,1458 8,14659,15025,14784,15098,15185,15465,12166,131 04,13208,13814,13323,13889,13994,14412,13552,14 020,1410 2,14541,14116,14560,14635,14983,13580,14108,141 59,14617,14279,14654,14749,15085,14381,14777,14 821,1512 1,14892,15217,15255,15499,13669,14306,14346,147 13,14449,14791,14832,15164,14490,14888,14949,15 241,1500 8,15296,15357,15589,14667,14953,15029,15305,151 09,15375,15408,15666,15169,15440,15483,15700,15 537,1575 7,15808,15975,10341,11466,11650,12609,11895,127 42,12851,13487,11949,12882,12986,13563,13091,13 653,1378 8,14362,12140,13054,13220,13711,13286,13882,138 42,14387,13340,13918,14001,14483,14095,14520,14 571,1496 5,12481,13248,13342,13876,13548,13982,14032,145 48,13562,14100,14135,14573,14186,14636,14680,15 055,1358 6,14174,14250,14673,14374,14744,14813,15128,144 26,14871,14889,15226,14950,15257,15320,15569,12 543,1354 6,13555,14085,13599,14110,14203,14646,13687,142 84,14339,14726,14406,14801,14882,15195,14014,14 368,1445 6,14819,14495,14905,14955,15250,14642,14959,150 33,15309,15115,15367,15404,15663,14128,14503,14 616,1491 0,14668,15019,15067,15336,14760,15095,15138,154 00,15191,15444,15495,15723,14827,15173,15236,15 482,1528 8,15524,15566,15764,15346,15580,15619,15801,156 42,15862,15869,16061,12587,13608,13652,14354,13 976,1439 5,14432,14865,14056,14481,14534,14925,14629,149 75,15050,15325,14150,14566,14661,14995,14719,15 075,1514 3,15391,14807,15186,15133,15425,15251,15490,155 36,15734,14382,14686,14743,15101,14845,15153,15 231,1547 2,14899,15237,15287,15525,15315,15541,15593,157 96,15012,15300,15353,15574,15411,15626,15658,15 840,1545 2,15692,15716,15888,15760,15914,15923,16026,144 97,14751,14895,15240,14971,15278,15301,15558,15 043,1536 2,15381,15613,15429,15629,15703,15867,15062,154

20,15477,15689,15532,15724,15730,15920,15584,15
767,1579
1,15941,15833,15979,16002,16110,15200,15517,155
28,15751,15606,15770,15804,15950,15637,15837,15
846,1599
8,15897,16004,16065,16145,15673,15881,15908,160
35,15945,16048,16081,16170,15967,16089,16106,16
190,1612
8,16207,16219,16275,6080,6770,6900,7740,7056,776
5,8059,8800,7244,7955,8182,8961,8441,9163,9253,1
0272,74
72,8087,8249,9152,8585,9320,9608,10324,8745,9595
,9452,10447,9860,10578,10690,11460,7607,8453,866
6,9426,
8771,9581,9728,10476,9028,9793,9896,10592,10169,
10807,10901,11635,9186,9951,10247,10865,10314,1
0979,11
087,11738,10440,11107,11231,11946,11306,12039,1
2181,12860,7898,8477,8905,9766,9063,9883,10146,1
0727,92
83,10261,9981,10905,10413,11024,11185,11814,950
5,10231,10424,11102,10539,11207,11280,11984,106
57,11326,
11481,12106,11624,12228,12358,13053,9763,10451,
10603,11257,10817,11377,11557,12215,10952,11570
,11733,1
2306,11826,12445,12545,13200,11134,11801,11962,
12487,12004,12550,12678,13320,12152,12728,12820
,13408,1
2914,13497,13640,14238,8319,8892,9092,10195,937
2,10298,10348,11182,9625,10414,10550,11247,1066
6,11366,
11428,12203,9849,10562,10701,11389,10876,11547,
11709,12327,11012,11711,11811,12415,11972,12530
,12656,1
3282,10015,10783,10964,11615,11039,11719,11849,
12501,11234,11958,12015,12564,12147,12719,12784
,13406,1
1402,12084,12218,12749,12314,12892,12926,13489,
12457,12991,13141,13596,13242,13699,13894,14241
,10121,1
0988,11197,11870,11353,11993,12128,12740,11470,
12161,12249,12850,12359,12922,13046,13566,11688
,12332,1
2417,12983,12553,13101,13218,13737,12637,13255,
13349,13821,13435,13931,13998,14493,11843,12510
,12613,1
3160,12757,13277,13367,13867,12912,13397,13495,
13964,13604,14013,14166,14627,13032,13524,13643
,14093,1
3684,14207,14268,14722,13879,14305,14365,14706,
14438,14798,14917,15275,8611,9295,9441,10528,96
36,10575 ,10741,11542,9662,10754,10917,11648,110
62,11824,11879,12648,9991,10931,11076,11927,112
18,11969,12072,12
650,11315,12071,12191,12810,12335,12902,12952,1
3486,10079,11196,11339,11937,11508,12092,12227,
12893,11
601,12286,12368,12964,12443,13088,13179,13672,1
1578,12423,12521,13083,12635,13225,13292,13822,
12769,13
376,13442,13929,13517,13983,14109,14592,10285,1
1450,11509,12265,11675,12403,12513,13056,11741,
12542,12
593,13207,12688,13314,13389,13921,12173,12659,1
2760,13341,12862,13425,13515,13972,13003,13545,
13656,14
084,13746,14201,14278,14693,12395,12832,12970,1
3476,13080,13594,13666,14172,13187,13719,13771,
14232,13
897,14337,14388,14776,13358,13888,13937,14367,1
3974,14440,14350,14831,14132,14575,14628,14940,
14644,15
074,15137,15341,10398,11660,11696,12626,12096,1
2715,12781,13368,12274,12801,12870,13459,13001,
13554,13
651,14177,12372,12989,13070,13561,13152,13668,1
3754,14249,13256,13780,13864,14321,13966,14380,
14488,14
850,12646,13090,13171,13752,13285,13841,13947,1
4353,13452,13950,14004,14475,14133,14431,14605,
14954,13
585,14061,14190,14577,14254,14641,14700,15028,1
4338,14712,14710,15118,14837,15158,15210,15470,
12824,13
246,13378,13954,13551,14011,14107,14517,13658,1
4173,14214,14632,14297,14658,14707,15065,13756,
14263,14
358,14694,14403,14718,14842,15161,14511,14858,1
4911,15220,14992,15292,15335,15592,13922,14371,
14459,14
844,14600,14852,14973,15244,14622,14962,15038,1
5318,15100,15373,15450,15678,14664,15079,15152,
15399,15
194,15459,15424,15706,15271,15508,15543,15780,1
5607,15816,15864,15974,8933,9477,9739,10629,992
3,10940,
11078,11855,10066,11111,11223,11924,11350,12059
,12081,12881,10109,11340,11437,12048,11519,1240
6,12466,
13025,11764,12475,12625,13190,12697,13296,13386
,13958,10136,11495,11664,12437,11788,12616,1266
5,13273,
11858,12738,12791,13400,12889,13498,13578,14018
,11960,12843,12945,13533,13063,13649,13701,1414
7,13109,
13674,13787,14261,13813,14314,14373,14929,10793
,11774,11834,12690,11936,12793,12884,13470,1211
7,12955,
13012,13615,13129,13729,13777,14185,12261,13021
,13169,13691,13266,13810,13831,14283,13338,1383
7,13858,
14385,14055,14441,14559,14958,12382,13264,13306
,13855,13423,13940,13956,14417,13508,14053,1411
5,14510,
14222,14593,14634,15042,13612,14162,14256,14639,14343,14687,14783,15104,14455,14794,14862,15163,14914,
15225,15303,15582,10839,11901,12061,12934,12238,13013,13149,13744,12346,13181,13275,13839,13360,13874,
13904,14409,12540,13312,13415,13914,13506,14038,14098,14502,13605,14139,14216,14619,14286,14666,14747,
15049,12670,13468,13575,14113,13708,14192,14187,14671,13759,14265,14311,14725,14422,14787,14812,15171,
13872,14345,14448,14800,14504,14875,14916,15248,14572,14948,15010,15319,15114,15383,15455,15688,12772,
13634,13725,14270,13829,14336,14425,14795,14035,14453,14526,14902,14538,14924,14987,15286,14064,14531,
14570,14970,14679,15006,15087,15370,14769,15107,15148,15403,15208,15481,15514,15714,14141,14705,14734,
15053,14825,15120,15157,15439,14864,15204,15254,15504,15304,15549,15599,15790,15017,15259,15324,15557,
15395,15616,15641,15851,15443,15667,15704,15877,15747,15925,15966,16096,11052,12119,12293,13183,12523,
13303,13403,13979,12572,13431,13528,14047,13622,14125,14248,14750,12748,13583,13738,14179,13793,14330,
14292,14774,13846,14361,14434,14857,14519,14887,14934,15272,13065,13762,13848,14322,14030,14415,14462,
14909,14045,14524,14554,14936,14598,14988,15027,15349,14069,14586,14653,15023,14764,15084,15142,15407,
14806,15189,15206,15489,15256,15516,15570,15772,13118,14027,14037,14508,14079,14533,14615,14998,14158,
14684,14730,15068,14790,15132,15198,15464,14446,14757,14830,15146,14868,15221,15261,15511,14994,15267,
15328,15560,15398,15609,15635,15849,14547,14873,14968,15223,15018,15314,15355,15579,15094,15380,15415,
15632,15460,15669,15712,15898,15154,15447,15498,15702,15540,15736,15769,15931,15588,15783,15813,15960,
15832,16006,16013,16161,13162,14087,14123,14742,14410,14780,14810,15184,14480,14855,14898,15235,14982,
15280,15345,15573,14563,14930,15013,15295,15061,15361,15418,15625,15136,15457,15412,15657,15512,15709,
15746,15905,14770,15031,15083,15385,15168,15427,15493,15695,15216,15500,15539,15737,15565,15750,15793,
15955,15307,15552,15596,15777,15644,15821,15842,15990,15676,15872,15893,16027,15927,16049,16054,16133,
14870,15089,15211,15502,15277,15531,15553,15763,15338,15605,15618,15807,15660,15823,15879,16011,15352,
15654,15698,15870,15744,15899,15903,16052,15785,15933,15949,16069,15983,16100,16118,16199,15468,15729,
15739,15919,15800,15935,15962,16076,15830,15989,15996,16113,16032,16119,16163,16223,15859,16023,16045,
16143,16073,16149,16177,16244,16088,16181,16196,16257,16212,16269,16279,16318,10049,10724,10849,11609,
10995,11631,11886,12498,11168,11798,11989,12622,12204,12778,12848,13590,11373,11911,12045,12771,12321,
12898,13115,13631,12451,13106,12997,13712,13300,13800,13877,14369,11492,12212,12391,12977,12472,13095,
13205,13734,12675,13252,13325,13811,13520,13955,14016,14478,12796,13365,13573,13996,13624,14071,14136,
14542,13709,14151,14226,14662,14277,14717,14796,15165,11748,12233,12579,13232,12702,13317,13502,13901,
12871,13584,13388,14019,13689,14096,14199,14584,13043,13564,13696,14149,13775,14211,14259,14685,13857,
14288,14383,14754,14473,14824,14896,15264,13229,13716,13818,14245,13960,14318,14429,14816,14050,14439,
14540,14867,14591,14945,15000,15339,14169,14576,14672,14966,14697,15001,15071,15396,14782,15096,15144,
15438,15193,15479,15546,15805,12103,12569,12725,13542,12941,13609,13646,14197,13130,13690,13782,14239,
13861,14312,14352,14809,13294,13790,13883,14327,14002,14424,14522,14881,14090,14523,14582,14927,14677,
14990,15056,15376,13411,13939,14058,14468,14105,14528,14607,14974,14229,14669,14703,15011,14778,15093,
15126,15437,14334,14740,14818,15106,14872,15182,15199,15476,14952,15233,15308,15527,15358,15575,15661,
15806,13483,14076,14206,14620,14303,14690,14767,15103,14375,14785,14834,15159,14897,15196,15260,15513,
14509,14883,14928,15230,15004,15290,15348,15590,15047,15363,15409,15627,15451,15675,15705,15906,14602,
14979,15035,15316,15110,15374,15416,15650,15192,15432,15478,15690,15529,15711,15776,15956,15252,15491,
15548,15745,15568,15794,15818,15992,15655,15834,15857,15985,15885,16020,16060,16174,12342,12878,12990, 13769,13138,13797,13911,14420,13157,13919,14025,14485,14120,14590,14624,15052,13394,14036,14130,14652,
14219,14674,14733,15054,14281,14732,14802,15139,14885,15187,15212,15474,13457,14205,14295,14657,14401,
14745,14823,15183,14458,14856,14900,15219,14944,15283,15326,15562,14442,14931,14985,15282,15046,15351,
15382,15628,15117,15421,15453,15674,15488,15699,15753,15943,13601,14364,14402,14843,14500,14920,14981,
15266,14544,14997,15026,15342,15077,15394,15428,15670,14793,15059,15112,15406,15166,15446,15487,15693,
15239,15503,15554,15741,15595,15792,15824,15980,14915,15150,15222,15469,15279,15526,15559,15778,15330,
15583,15608,15803,15662,15844,15866,16010,15413,15659,15677,15858,15694,15886,15850,16030,15761,15938,
15957,16068,15964,16111,16131,16193,13679,14491,14514,15041,14748,15091,15124,15417,14848,15134,15170,
15461,15238,15507,15551,15781,14903,15232,15273,15510,15313,15561,15598,15810,15364,15612,15648,15838,
15691,15863,15904,16036,15051,15284,15322,15597,15378,15636,15682,15852,15458,15684,15707,15900,15762,
15882,15948,16072,15522,15731,15787,15939,15811,15963,15982,16098,15845,15988,15987,16126,16031,16139,
16154,16231,15147,15360,15422,15685,15505,15710,15752,15915,15555,15779,15797,15958,15831,15969,15986,
16108,15600,15815,15854,15981,15871,15991,16033,16140,15913,16040,16057,16157,16085,16179,16191,16261,
15671,15860,15894,16034,15947,16037,16079,16164,15954,16075,16101,16186,16122,16203,16224,16283,15971,
16112,16136,16210,16148,16227,16217,16289,16172,16239,16248,16305,16265,16313,16323,16344,12601,13017,
13213,13835,13346,14041,14131,14609,13449,14155,14223,14650,14300,14727,14737,15176,13477,14296,14355,
14720,14407,14922,14956,15249,14557,14960,15040,15333,15081,15384,15426,15687,13496,14392,14494,14942,
14568,15037,15063,15371,14612,15102,15130,15434,15180,15480,15520,15713,14670,15156,15209,15496,15269,
15550,15576,15768,15293,15563,15615,15814,15624,15836,15861,16063,13944,14561,14595,15078,14656,15131,
15178,15467,14762,15214,15242,15535,15302,15587,15610,15784,14840,15246,15321,15571,15369,15623,15631,
15825,15405,15633,15645,15865,15728,15887,15932,16074,14907,15368,15390,15643,15445,15679,15686,15876,
15485,15727,15755,15912,15799,15944,15959,16102,15533,15774,15812,15961,15847,15978,16014,16123,15892,
16018,16041,16141,16058,16160,16182,16259,13977,14637,14728,15202,14828,15243,15311,15594,14890,15327,
15372,15634,15414,15653,15664,15873,14996,15393,15441,15668,15484,15722,15748,15909,15530,15765,15798,
15953,15827,15972,16000,16104,15066,15466,15518,15754,15578,15788,15786,15973,15601,15817,15835,15994,
15878,16015,16025,16144,15652,15848,15890,16021,15910,16047,16059,16165,15937,16071,16091,16187,16125,
16205,16225,16284,15119,15544,15585,15819,15630,15843,15880,16019,15720,15891,15918,16055,15924,16062,
16083,16178,15733,15921,15936,16078,15976,16090,16116,16202,16007,16124,16135,16211,16153,16232,16242,
16292,15766,15984,15997,16105,16028,16127,16138,16220,16042,16151,16166,16238,16183,16249,16263,16308,
16093,16168,16188,16252,16208,16267,16273,16321,16221,16280,16288,16326,16299,16334,16343,16363,14114,
14763,14859,15329,14986,15388,15435,15696,15014,15448,15494,15726,15538,15759,15809,16001,15105,15521,
15591,15782,15617,15841,15829,16009,15638,15856,15884,16039,15916,16050,16066,16173,15270,15603,15639,
15839,15719,15875,15896,16056,15725,15917,15930,16067,15946,16084,16097,16195,15735,15942,15968,16095,
16005,16115,16132,16213,16022,16147,16152,16233,16167,16243,16255,16303,15297,15717,15721,15911,15740,
15922,15952,16087,15773,15977,15995,16109,16017,16129,16150,16229,15889,16003,16029,16134,16043,16158,
16169,16240,16086,16171,16189,16253,16209,16266,16272,16320,15928,16046,16077,16159,16094,16185,16198,
16258,16120,16204,16215,16271,16228,16281,16291,16329,16137,16222,16235,16287,16247,16294,16302,16336,
16260,16306,16312,16341,16317,16349,16351,16371,15317,15743,15758,15999,15874,16012,16024,16146,15901,
16038,16053,16162,16082,16176,16194,16256,15934,16064,16092,16180,16107,16200,16216,16270,1613

0,16226,16214,16277,16241,16290,16298,16332,16008,16099,16114,16206,16142,16218,16234,16285,16156,16236,16246,16295,16254,16300,16309,16340,16184,16250,16262,16304,16274,16314,16319,16347,16282,16325,16328,16353,16335,16356,16358,16368,16044,16117,16155,16237,16175,16245,16251,16301,16192,16264,16268,16311,16278,16315,16327,16350,16197,16276,16286,16324,16297,16330,16331,16357,16307,16337,16339,16359,16345,16364,16366,16376,16230,16293,16296,16333,16310,16338,16342,16361,16316,16346,16348,16365,16354,16367,16372,16378,16322,16352,16355,16369,16360,16370,16373,16379,16362,16374,16375,16380,16377,16381,16382,163831

**Sequence group 5: Q5_2048**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1026,520 ,288,528,192,544,70,44,131,81,50,73,15,320,133,52,23,134,384,76,137,82,56,27,97,39,259,84,138,145,261,29,43,98,515,88,140,30,146,1028,71,262,265,161,576,45,100,640,1025,51,148,46,75,266,273,517,104,162,53,193,1032,152,77,164,768,268,274,518,54,83,57,521,112,1024,135,78,289,194,85,276,522,58,168,139,99,86,60,280,89,290,529,524,196,141,1040,101,147,176,142,530,321,31,200,90,1056,545,292,322,532,263,149,102,105,304,296,1030,163,92,1033,47,267,385,546,324,208,386,150,153,165,106,55,328,1088,536,577,548,1034,113,154,79,269,108,578,224,166,519,552,195,270,1041,641,1036,523,275,580,291,59,169,560,114,277,156,87,1152,197,116,170,61,1042,531,525,642,281,278,526,177,293,388,1057,91,584,769,198,172,120,201,336,62,282,143,1029,1044,103,178,294,93,1058,644,202,592,323,392,297,770,107,180,1280,151,209,284,1027,648,94,204,298,400,608,1089,352,325,533,155,210,305,547,300,109,1048,184,534,1060,537,115,1090,167,225,326,306,772,157,656,329,110,117,212,171,1038,776,1064,330,1153,226,549,1043,538,387,308,216,416,271,279,158,337,550,672,1092,118,332,579,540,1072,389,173,1037,121,553,199,784,179,228,338,312,1536,704,1154,390,174,554,581,1046,393,283,122,448,353,561,1096,203,63,340,394,1049,1281,527,582,556,181,295,1059,285,232,124,205,182,643,1156,562,286,585,299,354,1045,211,401,1104,185,1061,396,344,586,645,1282,593,535,240,1050,206,95,327,564,800,402,356,307,301,417,1160,213,1066,568 ,1120,832,588,1035,1537,186,646,404,1091,227,896,594,418,302,649,771,360,539,111,1052,331,1168,214,309,1062,1284,188,449,1073,217,408,609,596,551,650,229,159,420,310,1093,541,1288,773,610,657,333,1065,119,1098,600,339,1184,218,368,652,1031,230,391,313,450,542,1538,334,1076,233,555,774,175,123,1155,658,612,341,777,220 ,314,1105,424,1068,395,673,583,355,1296,1094,287,183,234,1051,125,557,1216,660,616,342,316,1157,241,778,563,1074,345,452,397,403,1112,207,1540,674,558,785,1100,432,1039,357,187,1162,236,664,1312,624,587,780,1080,1122,705,126,242,1063,565,398,346,456,358,405,303,569,1544,244,1158,1097,595,1283,189,566,676,1169,1054,1108,361,706,589,1344,215,786,647,348,419,406,464,680,801,1069,362,1164,590,409,1286,570,1121,788,1552,1106,597,1075,572,1186,219,311,708,598,1289,601,651,421,792,802,611,1047,602,1172,410,231,688,653,1128,248,1070,369,190,364,1568,654,1095,659,1161,335,480,315,221,370,1285,613,1408,422,425,451,1077,614,543,1298,235,412,343,372,1185,775,317,1539,222,1099,426,453,237,1124,559,1170,1292,833,804,712,1082,834,661,1053,808,779,1217,617,604,1541,433,720,816,1101,1176,836,347,897,1136,243,1297,662,1600,454,318,675,1110,618,1081,898,781,1314,1220,376,428,1546,665,736,567,1107,1192,1078,840,625,238,1159,359,457,399,787,591,678,434,677,1290,1542,349,1300,1102,245,1188,458,666,1113,620,1553,1163,1313,363,127,1067,191,1125,782,407,436,626,1218,571,465,681,246,707,1346,350,1084,599,668,1548,790,1165,1320,460,1123,1200,249,682,1664,573,1171,411,803,1116,789,1304,709,365,440,628,689,374,1224,423,1556,466,793,1130,250,371,1174,481,574,1348,413,1109,603,366,1545,1287,1055,468,1570,655,900,805,615,1166,684,1409,710,1187,429,794,252,1114,373,605,1232,848,690,713,632,1316,482,806,1132,1083,427,1177,904,1569,414,1291,223,1126,1554,663,692,835,1328,619,472,1137,455,796,1189,1601,809,714,1248,721,837,716,1086,13

02,1352,864,810,1173,606,1194,912,1103,722,696,377,1424,
435,1293,1560,817,1129,1792,319,621,1180,812,484,1345,430,1572,1138,1299,838,667,1219,488,1111,239,378,45
9,622,1410,627,437,380,1201,1608,818,1178,1294,461,1543,496,669,1190,1317,679,1140,1079,1221,724,841,1305 ,629,1584,351,467,1360,438,1115,737,251,462,442,441,1666,469,1549,247,683,1196,1226,842,1412,1127,738,114
4,1308,899,1602,670,1318,783,1085,849,1555,1193,820,1576,728,928,791,367,1376,901,1233,630,1321,685,844,1
204,633,711,1118,253,691,1301,824,1175,902,686,1668,1222,1416,1133,740,1347,850,375,1558,444,1306,470,116
7,483,1547,415,485,905,1202,795,473,1240,634,744,1616,852,960,1322,865,693,1131,1794,1350,797,1225,1604,1
571,906,1252,715,1141,1330,807,474,636,1179,694,254,1550,1665,717,1071,1315,575,913,1440,798,811,379,1208 ,1353,1191,697,1564,431,1142,607,1228,489,1324,866,723,486,1573,1181,1234,908,1793,1561,718,813,1364,476,
856,1117,1411,839,1329,1295,1146,725,698,1472,914,1249,752,868,819,1349,814,439,929,1197,1578,490,1139,16
80,623,1632,1336,671,1198,1362,739,1603,1557,1413,916,1303,463,1236,843,1135,381,1672,1354,497,1586,930,8
21,726,961,1203,1182,872,1418,492,1250,1332,631,1574,1223,729,1145,1605,700,1796,443,1307,741,1378,1562,1
356,1205,845,1319,920,382,1585,822,1425,851,1229,730,1609,498,880,1256,742,445,1392,471,635,1148,1696,932 ,1580,687,1210,1420,1612,1325,1800,903,1134,825,1235,1361,500,1577,846,1670,1195,745,826,732,1264,446,962 ,1426,1620,936,1377,475,853,1310,867,637,1551,1230,1414,907,1206,1667,1588,1333,487,1808,695,1441,1087,74
6,828,753,1610,854,1237,1326,857,1368,1209,504,799,1355,255,964,1242,909,1673,1559,1309,719,1143,477,1617 ,915,1448,1380,638,748,944,1728,1331,1227,869,1592,1428,491,699,1253,1351,754,1183,1565,858,1618,1417,147
6,478,968,1260,383,1212,910,1801,815,1579,976,870,1684,1633,917,1337,1241,1606,1824,727,1150,1442,493,135
7,1251,1676,873,1384,701,1566,931,1323,1798,1365,1473,756,1334,860,499,731,1648,1238,823,1575,922,1199,16
74,874,1432,1421,918,1636,1254,502,1795,933,1366,1338,1682,1587,1211,1488,743,1358,760,1244,1581,881,114
7,494,1379,1272,702,921,1624,501,876,1415,847,1856,1444,992,1697,447,1607,1436,1369,1257,1704,733,1797,16
69,1340,1231,827,1590,934,1634,1474,882,937,963,1419,747,1265,1119,505,1381,855,924,1810,734,829,1563,121
3,1611,1363,1430,1258,1688,1386,965,1614,1730,1239,938,884,506,1327,1589,1804,749,1370,1640,945,966,1456,
1681,755,1266,859,1427,1593,1388,940,1214,830,1809,911,1621,1582,1832,871,639,1480,1698,1335,888,1372,12
45,479,1422,1268,946,1732,1677,750,1802,1626,1393,969,508,1613,861,1446,1857,1339,757,1382,970,1700,1243,
919,1594,1433,1826,1504,875,1635,1259,862,1920,1675,1445,758,1149,948,1359,1816,1596,1671,1712,977,1385,
923,1622,972,1434,1311,1729,761,1396,877,1207,1475,1449,1812,952,1686,495,1262,1644,1619,1341,1429,1825,
703,1371,1638,1567,1736,935,1685,978,1625,883,762,1246,503,1458,925,1394,1269,878,1478,735,1799,1678,186
0,1443,1637,1481,1373,1699,1255,993,1591,1828,1452,885,939,994,1400,1744,1656,980,1689,926,764,1270,941,1
628,1367,1805,1457,1921,1583,1387,1642,967,1267,1484,1450,886,831,1683,1342,1811,947,1705,1431,507,1261,
1840,889,1650,984,1760,1490,1615,751,1702,942,1858,1423,1460,1383,996,1692,1641,1814,971,1477,1273,1512,
1733,890,1598,1374,509,1806,1922,1649,949,973,1397,1489,1708,1627,1000,1690,892,1274,1438,1817,1390,1464 ,1868,950,1151,1731,1506,1827,1597,863,1451,759,1864,1714,1701,1395,1803,1008,1623,1482,1276,510,1435,16
52,979,1492,953,1928,1829,1389,1738,763,1872,974,1453,1643,1713,1818,1215,1402,1629,1520,1830,1691,954,1
459,1734,879,981,1505,1706,982,1924,927,1833,1639,1447,1746,1343,1679,1820,1761,1479,1275,995,1740,1401,
1888,765,956,1496,1861,887,1437,985,1720,997,1630,1813,1462,1398,1645,1848,1687,1247,1716,1936,986,1483,
1651,1745,943,1859,1508,1834,1454,891,1841,998,1595,1278,766,1465,1709,1764,1646,1737,511,1485,1404,1693 ,1866,1952,1491,988,1657,1752,1807,1399,1844,1001,951,1654,1926,1707,1391,1002,1468,1836,1494,1873,1271,
1694,893,1923,1461,1748,1715,975,1862,894,1815,1497,1653,1510,1762,1842,1375,1703,1009,1466,1874,955,173
9,1486,1930,1889,1004,1658,1821,1718,1929,1599,1507,1776,1405,1735,1831,1493,1010,1984,1455,957,1865,983 ,1710,958,1514,1876,1768,1721,1938,1660,1500,1403,1892,1819,1741,1516,987,1932,1463,1012,1843,1749,999,1
838,1277,1647,1925,1498,1742,1513,1880,1717,1016,1953,1837,1867,1631,1469,1747,767,1904,1724,152

4,989,14
06,1754,1822,1835,1499,1944,1863,1890,1467,1003, 1522,1763,1695,1850,990,1005,1937,1722,1845,1495 ,1655,17
65,1956,1487,1750,1869,1521,959,1896,1263,1940,1 770,1877,1509,1711,1756,1846,1011,1960,1784,1870 ,1662,10
13,1985,1753,1927,1528,1849,1882,1766,1511,1954, 1719,1777,895,1439,1006,1878,1891,1939,1661,1502 ,1986,18
52,1934,1723,1772,1515,1897,1014,1470,1743,1931, 1017,1968,1881,1894,1769,1517,1778,1941,1823,165 9,1992,1
875,1755,1501,1018,1900,1725,991,1933,1839,1525, 1955,1988,1884,1726,1948,1780,1518,1020,1767,190 5,1851,1
893,1945,1757,1530,1958,1471,1007,2000,1847,1898 ,1523,1942,1961,1871,1771,1529,1912,1758,1989,19 46,1526,
1906,1883,1773,1957,1853,1976,1015,1751,1993,150 3,1962,1781,1885,1908,2016,1854,1532,1972,1774,1 019,189
5,1987,1969,1782,1279,1943,1899,1994,1663,1964,1 785,1021,1935,1886,2001,1407,1779,1990,1970,1879 ,1022,19
02,1947,1759,1907,1527,1996,1786,1959,2002,1913, 1949,2017,1534,1788,1910,1965,2004,1901,1966,177 5,2008,1
531,1971,1950,1909,1991,2018,1727,1916,1855,1974 ,1995,2020,1977,1787,1914,2005,1887,1023,1963,19 98,1783,
2024,1980,1903,1973,2003,1789,1997,2032,1978,191 7,2010,1519,2019,2006,1951,1911,2021,2009,1790,2 026,197
5,2012,1967,1915,2025,2022,1981,1918,2033,1999,2 028,1533,2011,1982,2034,1979,2023,2013,2036,2007 ,2030,20
14,2040,1535,2027,2029,2035,2037,1791,2038,2041, 1919,2042,2039,2044,2043,2031,1983,2046,2047,201 5,2045]

**Sequence group 5: Z5_2048**

[0,1,2,7,3,8,11,24,4,10,13,28,16,33,35,77,5,1 2,14,32,19,38,47,81,22,46,42,88,57,96,102,166,6,17,2 1,40,
23,45,51,90,29,55,59,97,72,110,116,184,34,61,75,114 ,80,123,133,195,87,135,146,221,151,232,252,363,9,1 8,26,54,
30,58,71,105,36,76,62,117,84,127,140,204,44,74,86,1 34,92,143,150,227,100,153,168,244,182,260,277,402, 53,89,9
8,149,111,160,176,257,121,177,194,269,206,291,307, 433,137,202,224,297,230,308,331,462,249,339,357,4 83,376,5
04,541,725,15,25,31,73,39,79,82,139,48,85,93,148,10 1,158,163,254,56,94,103,161,115,175,191,272,126,19 2,203,2
86,226,304,326,451,64,108,122,181,128,193,209,299, 147,222,231,310,248,337,351,482,162,240,258,343,2 70,371,3
78,501,293,390,420,530,441,558,614,727,69,124,142, 212,157,229,247,341,167,250,263,362,278,377,401,5 21,189,2
73,287,387,309,412,437,568,322,444,467,592,489,62 4,644,819,208,300,316,424,344,450,471,607,375,479, 502,636,
532,648,700,874,399,512,542,675,553,715,737,915,6 11,751,773,908,799,951,1005,1192,20,37,41,91,49,95 ,106,174 ,50,107,118,185,130,205,213,324,63,119,13 1,218,144,225,238,325,152,237,253,356,274,374,382, 500,67,141,154,2
20,171,241,259,372,179,267,279,384,290,409,428,55 0,178,288,302,408,321,438,453,593,346,473,490,623, 510,642,
680,859,78,165,172,265,188,284,301,403,196,306,31 4,435,332,460,477,621,251,327,345,465,364,487,509, 638,393,
516,546,672,571,712,740,902,283,359,385,497,407,5 29,548,702,431,564,578,724,615,762,782,939,468,61 3,625,77
4,639,801,766,965,689,851,875,1016,881,1081,1115, 1229,83,186,190,320,242,336,350,472,266,355,365,4 94,392,5
18,545,704,280,388,406,519,422,549,573,730,445,58 1,606,756,637,779,817,973,323,410,427,572,452,599, 629,768,
492,630,646,813,690,797,865,1022,527,666,708,853, 731,880,905,1058,763,911,910,1105,967,1127,1155,1 308,358,
442,474,631,517,647,679,829,547,703,717,876,748,8 87,909,1077,574,735,770,903,786,913,969,1129,827, 978,1001 ,1161,1040,1201,1226,1385,622,776,809,97 1,863,974,1030,1174,872,1026,1062,1215,1094,1247, 1294,1444,889,10
84,1123,1263,1146,1300,1278,1463,1189,1331,1352, 1516,1396,1544,1581,1667,27,43,52,99,60,120,132,2 10,66,13
6,145,217,156,235,239,368,68,155,164,234,173,285,2 94,398,198,296,319,432,334,455,475,634,70,170,187, 289,200 ,317,328,448,211,340,352,480,370,505,524,6 50,223,360,381,514,404,544,559,694,414,551,583,73 4,590,754,777,10
11,109,199,207,333,219,353,369,496,245,383,394,53 6,417,566,580,706,264,397,426,556,447,588,595,742, 464,597,
604,781,664,802,845,1024,281,446,458,602,486,627, 633,791,508,663,683,826,720,860,877,1065,535,699, 732,879,
764,900,943,1097,807,948,980,1130,1002,1165,1206, 1378,112,215,236,379,262,395,421,570,276,429,449, 598,469,
609,617,788,305,459,485,619,507,658,677,822,533,6 92,718,870,743,890,927,1068,329,495,523,681,560,7 09,707,8
93,575,736,752,916,793,945,957,1135,608,765,805,9

52,823,987,1004,1176,850,1020,1049,1216,1103,125
3,1297,1
451,348,540,565,738,594,761,795,949,655,806,834,9
97,838,1008,1037,1199,667,836,849,1029,897,1048,1
088,124
4,936,1100,1121,1264,1153,1314,1336,1470,693,907,
922,1071,962,1107,1126,1287,981,1151,1179,1328,1
207,1356 ,1391,1525,1053,1181,1219,1363,1260,140
2,1419,1571,1289,1435,1461,1591,1493,1628,1661,1
772,129,246,268,4
30,303,457,481,641,312,488,513,661,537,686,729,92
9,342,525,569,705,585,759,745,938,600,771,798,977,
830,991, 10 14,
1190,405,576,601,757,654,790,810,1000,660,833,843
, 10 15,862, 1038, 1057, 1233,668,856,884, 1055,934,
1087,
1117,1267,954,1143,1152,1319,1180,1337,1371,1509
,416,653,657,824,671,837,869,1044,698,898,919,107
9,946,11
12,1148,1303,804,931,964,1119,983,1162,1183,1333,
1041,1186,1222,1365,1262,1398,1415,1569,842,986,
1028,116
4,1054,1212,1236,1377,1092,1251,1272,1412,1301,1
437,1468,1607,1124,1292,1324,1460,1351,1484,1508
,1632,13
82,1519,1541,1656,1556,1693,1700,1831,425,673,68
5,925,789,941,956,1141,815,975,995,1169,1034,1195
,1231,13
73,847,1012,1051,1203,1075,1239,1275,1407,1114,1
298,1269,1429,1334,1465,1492,1613,937,1059,1086,
1255,113
3,1280,1321,1456,1159,1325,1350,1485,1369,1495,1
527,1651,1208,1359,1388,1513,1421,1548,1563,1681
,1442,15
86,1604,1712,1629,1732,1736,1804,984,1089,1156,1
326,1193,1346,1360,1504,1227,1395,1404,1536,1431
,1549,15
93,1698,1235,1427,1458,1584,1490,1608,1611,1734,
1521,1634,1647,1749,1674,1776,1791,1867,1306,148
0,1486,1
624,1532,1636,1658,1755,1554,1680,1686,1786,1717
,1792,1833,1888,1577,1709,1729,1814,1752,1819,18
46,1909,
1765,1850,1864,1922,1878,1934,1943,1982,138,113,
65,275,104,255,180,470,125,183,201,418,216,338,31
1,528,15
9,214,233,318,256,386,354,603,292,366,400,503,434,
659,562,785,169,243,261,373,295,391,439,543,313,4
61,413,7
26,493,577,612,1009,335,443,515,589,478,632,697,8
95,538,684,656,812,741,930,839,1178,197,282,298,4
23,330,4
54,499,618,361,555,463,645,526,669,714,848,389,49
1,587,695,563,780,682,873,520,719,800,906,758,104
2,950,13
30,415,584,539,749,649,728,820,921,610,857,772,98
8,811,961,1142,1080,674,828,867,1063,894,998,1023
,1200,92
3,1101,1047,1293,1131,1420,1245,1564,228,315,349,
484,380,511,554,701,411,620,531,722,579,746,792,9
70,436,5
61,651,755,605,844,775,955,670,814,885,1003,861,1
032,1091,1220,466,640,591,796,716,831,891,1019,69
6,933,84
6,1150,917,1060,1069,1270,750,882,976,1090,947,11
11,1170,1438,1017,1188,1136,1285,1230,1339,1370,
1598,506 ,662,733,871,688,896,959,1099,767,992,91
8,1211,1025,1120,1167,1318,803,942,1033,1144,107
8,1184,1266,1349,
979,1241,1194,1406,1290,1384,1462,1644,835,1052,
1095,1249,996,1217,1277,1479,1125,1312,1343,1414
,1228,15
17,1445,1806,1154,1329,1364,1505,1387,1467,1494,
1691,1296,1538,1557,1623,1580,1757,1660,1927,271
,367,396 ,557,440,626,582,784,456,596,710,818,652,
854,886,1046,498,676,635,868,713,953,840,1076,760
,899,968,1106,92
4,1198,1163,1433,534,723,687,1010,808,892,928,111
3,747,944,985,1256,1027,1139,1185,1353,825,1045,9
99,1210 ,1096,1173,1261,1381,1067,1240,1282,1401,
1317,1448,1511,1618,567,864,739,963,778,1056,990,
1218,841,1018,1
083,1191,1110,1248,1288,1422,904,1145,1070,1341,
1039,1258,1281,1497,1187,1311,1357,1452,1383,147
7,1543,1
707,940,1160,1108,1295,1205,1332,1403,1531,1252,
1428,1345,1502,1368,1589,1560,1685,1128,1394,146
6,1575,1
436,1550,1640,1678,1487,1626,1599,1744,1669,1725
,1777,1938,628,794,878,1043,920,1074,1168,1302,96
0,1224,
1093,1327,1137,1274,1386,1529,852,1118,1157,1366
,1214,1449,1342,1515,1273,1409,1432,1582,1310,16
33,1558,
1832,1013,1177,1246,1474,1305,1418,1399,1616,120
4,1440,1507,1570,1483,1594,1655,1731,1361,1499,1
464,160
5,1530,1695,1639,1751,1561,1662,1710,1785,1687,1
770,1847,1887,1050,1259,1323,1439,1225,1537,1469
,1622,13
79,1476,1579,1648,1506,1668,1714,1800,1286,1551,
1523,1673,1585,1728,1689,1796,1630,1702,1760,178
1,1743,1
863,1838,1912,1411,1609,1566,1723,1653,1810,1704
,1827,1539,1762,1737,1844,1748,1855,1877,1997,16
01,1803,
1787,1892,1775,1870,1902,1948,1823,1897,1885,196
5,1919,2017,1956,2029,347,419,476,643,522,665,711
,888,55
2,783,691,972,744,914,1006,1166,586,721,821,932,7
69,1073,966,1197,855,1036,1109,1338,1021,1221,12
54,1454,
616,816,787,994,866,1031,1098,1268,935,1147,1061,
1234,1134,1291,1375,1501,901,1116,1085,1284,1172
,1354,1
320,1481,1213,1367,1408,1659,1424,1568,1542,1722,678,832,926,1072,993,1102,1242,1309,883,1122,1182,1340,1138,1397,1347,1524,982,1202,1223,1447,1158,1374,1430,1578,1299,1459,1393,1553,1496,1600,1637,1769,1066,1238,1322,1413,1276,1475,1453,1615,1358,1534,1503,1595,1446,1641,1665,1758,1265,1547,1520,1649,1583,1703,1682,1797,1489,1675,1718,1859,1742,1837,1818,1931,753,1007,912,1171,958,1316,1149,1425,1082,1196,1271,1417,1250,1390,1472,1619,1064,1362,1283,1510,1237,1457,1443,1643,1344,1491,1555,1603,1533,1670,1692,1789,1132,1307,1380,1478,1405,1574,1526,1708,1313,1514,1610,1684,1552,1663,1735,1811,1426,1596,1573,1697,1645,1764,1720,1829,1635,1740,1794,1842,1774,1866,1874,1971,1209,1434,1348,1565,1389,1540,1606,1726,1455,1666,1590,1713,1625,1747,1761,1848,1488,1650,1617,1771,1696,1754,1801,1910,1676,1821,1778,1862,1812,1884,1899,1946,1522,1621,1705,1788,1664,1798,1826,1879,1739,1854,1808,1896,1843,1905,1921,1963,1724,1830,1856,1939,1876,1914,1926,1985,1816,1933,1950,1978,1957,1991,2004,2034,858,1035,989,1279,1104,1315,1257,1471 ,1140,1232,1392,1576,1355,1498,1545,1677,1175,1372,1335,1512,1441,1638,1535,1701,1423,1559,1597,1746,1620,1719,1779,1858,1243,1450,1410,1567,1482,1588,1602,1727,1376,1614,1654,1780,1688,1767,1756,1869,1518,1657,1706,1753,1679,1795,1813,1890,1642,1824,1790,1881,1840,1907,1918,1973,1304,1400,1528,1652,1473,1631,1699,1783,1572,1733,1671,1768,1562,1802,1817,1895,1592,1690,1711,1861,1738,1809,1834,1942,1763,1852,1825,1904,1873,1915,1936,1981,1627,1716,1784,1835,1745,1882,1853,1923,1805,1845,1891,1929,1865,1961,1944,1988,1773,1880,1903,1947,1916,1968,1958,2001,1898,1953,1979,2009,1972,1995,2013,2037,1416,1500,1546,1694,1612,1759,1683,1822,1587,1721,1715,1849,1750,1868,1841,1935,1646,1793,1741,1836,1807,1857,1893,1928,1782,1883,1901,1945,1875,1954,1967,2000,1672,1766,1828,1871,1799,1906,1886,1951,1815,1894,1913,1983,1932,1959,1962,2008,1851,1925,1941,1966,1920,1989,1974,2006,1908,1977,1994,2021,1987,2012,2019,2043,1730,1820,1839,1924,1872,1900,1940,1969,1860,1911,1930,1975,1949,1992,1984,2015,1889,1937,1952,1990,1960,1980,1999,2025,1964,2003,1996,2018,2007,2023,2027,2046,1917,1955,1970,1998,1976,2002,2011,2022,1986,2010,2005,2030,2016,2031,2026,2042,1993,2014,2020,2032,2024,2033,2035,2039,2028,2036,2038,2041,2040,2047,2044,2045]

**Sequence group 5: Q5_4096**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1026,520288,528,192,544,70,44,131,81,50,73,15,320,133,52,23,134,384,76,137,82,56,27,97,39,259,84,138,145,261,29,43,98,515,88,140,30,146,1028,71,262,265,2048,161,576,45,100,640,1025,51,148,46,75,266,273,517,104,162,53,193,1032,152,77,164,768,268,274,518,54,83,57,521,112,1024,135,78,289,194,85,276,522,58,168,139,99,86,60,280,89,290 ,529,524,196,141,1040,101,147,176,2049,142,530,321,31,200,90,1056,545,292,322,532,2050,263,149,102,105,304,296,1030,163,92,1033,47,267,385,546,324,2052,208,386,150,153,165,106,55,328,1088,536,577,548,1034,113,154,79,269,108,578,2056,224,166,519,552,195,270,1041,641,1036,523,275,580,291,59,169,560,114,277,156,87,1152,197,116,170,2064,61,1042,531,525,642,281,278,526,177,293,388,1057,91,584,769,198,2080,172,120,201,336,62,282,143,1029,1044,103,178,294,93,1058,644,202,2051,592,323,392,2053,297,770,107,180,1280,151,209,284,1027,648,94,204,298,400,608,2112,1089,352,325,533,155,210,305,2057,547,300,109,1048,184,534,1060,537,115,1090,167 ,225,326,2054,306,772,157,2065,656,329,110,117,212,171,1038,776,1064,330,1153,2058,226,549,1043,538,387,308,216,416,271,279,158,337,2066,550,672,1092,118,332,579,540,1072,2176,389,173,1037,121,553,199,784,179,228 ,338,312,1536,704,1154,390,174,554,581,1046,393,2060,283,2081,122,448,353,2113,561,1096,203,63,340,394,1049,1281,527,582,556,181,295,1059,285,232,124,2068,205,182,643,2304,1156,562,286,585,299,354,2082,1045,211,401,1104,185,1061,396,344,586,645,1282,593,535,240,2072,1050,206,95,327,2084,564,800,402,2055,356,307,301,417,1160,213,1066,568,1120,832,588,1035,1537,186,2177,646,404,2114,1091,227,896,594,418,2560,302,649,771,3 60,539,2059,111,1052,331,1168,214,309,1062,1284,2088,188,449,1073,217,408,609,596,2116,551,650,229,159,42
0,2178,310,1093,541,1288,773,610,657,333,1065,119,1098,2067,2061,600,339,1184,218,2096,368,652,1031,230,3
91,313,450,542,1538,334,1076,233,555,2062,774,175,123,1155,658,2120,612,341,2305,777,220,314,2069,1105,42
4,1068,395,673,583,355,1296,2180,1094,287,183,234,1051,125,557,1216,660,616,342,316,2083,1157,241,778,230
6,563,2074,1074,345,452,397,2561,403,1112,207,2128,1540,674,558,785,1100,432,1039,357,187,1162,236,664,13
12,624,587,780,1080,2085,1122,705,2073,126,242,2070,1063,565,398,2184,346,456,2308,358,405,303,569,2312,1
544,244,1158,1097,595,1283,189,566,676,1169,1054,1108,361,2086,706,589,2562,1344,215,786,647,348,2144,211
5,419,406,464,680,801,2089,1069,362,1164,590,409,1286,570,1121,788,1552,2192,1106,2076,597,1075,572,1186,
219,311,2117,708,598,2090,1289,601,651,421,792,802,2564,611,1047,602,1172,410,231,2097,688,653,1128,248,1
070,2122,369,2320,190,364,1568,654,2208,1095,659,1161,335,480,315,221,3074,370,1285,613,2568,1408,422,425 ,2336,451,1077,614,543,1298,235,412,2576,343,372,2240,1185,775,317,2592,2118,1539,222,1099,426,2092,453,2
37,1124,559,1170,2179,1292,833,804,712,1082,834,661,1053,808,779,2129,1217,617,604,2098,1541,433,720,2121 ,816,1101,2063,1176,836,2368,347,897,2181,1136,243,1297,2100,662,2071,1600,454,318,675,1110,618,2182,1081 ,898,781,1314,1220,376,428,1546,665,736,567,1107,2432,1192,1078,840,2124,2185,625,238,2130,1159,359,457,2
104,399,787,2075,2145,591,678,434,677,2087,1290,1542,349,1300,1102,245,1188,458,666,1113,620,1553,1163,23
07,1313,363,2132,127,1067,191,2186,1125,782,407,2193,436,626,2309,2077,1218,571,465,681,2091,246,707,2146 ,1346,350,1084,599,668,2563,1548,790,1165,1320,460,1123,2136,1200,249,2188,682,1664,573,1171,411,803,2078 ,1116,789,2194,1304,709,365,440,628,689,3076,2119,374,1224,423,2310,1556,466,793,2313,1130,250,371,1174,4
81,574,1348,2209,413,2624,1109,603,366,2093,1545,2148,1287,1055,468,1570,655,900,2688,805,615,3073,1166,6
84,1409,710,2099,1187,429,794,2196,252,1114,373,605,1232,848,690,2094,2123,713,632,2314,1316,482,806,2321 ,1132,2565,1083,427,2152,1177,904,2210,1569,414,1291,2101,223,1126,2241,1554,663,3080,692,835,1328,619,47
2,2200,1137,455,796,2125,1189,1601,809,714,2212,1248,721,837,2816,716,1086,2316,1302,1352,864,2322,2566,8
10,2102,1173,606,1194,2131,912,2105,2569,1103,722,696,377,1424,435,2160,1293,1560,817,1129,1792,319,621,1
180,812,484,3072,1345,430,1572,2183,1138,2126,1299,838,2337,2242,667,1219,488,2133,1111,239,378,2324,257
0,459,622,2106,2216,1410,627,437,2187,380,2147,1201,1608,818,1178,1294,461,2134,1543,496,669,1190,1317,67
9,1140,1079,2108,1221,724,2328,841,1305,629,2137,1584,351,467,2338,2577,1360,438,2572,2244,1115,737,251,4
62,2189,442,441,3088,2149,1666,469,2195,1549,247,683,2224,1196,1226,842,1412,1127,738,1144,2190,1308,899,
2578,1602,670,1318,783,2369,1085,849,2079,1555,1193,820,2248,1576,728,928,2138,791,367,3104,2593,1376,90
1,1233,630,2340,2370,1321,685,844,2580,1204,633,711,1118,253,691,2311,1301,2197,824,2150,1175,902,686,215
3,1668,1222,2352,1416,1133,740,1347,850,375,2344,1558,444,3078,1306,2211,470,1167,483,2140,1547,415,3081,
485,2095,905,1202,795,473,2315,1240,634,744,2433,2594,1616,852,960,2372,1322,865,693,2256,1131,2434,1794,
1350,797,2198,2201,1225,2213,1604,1571,906,1252,2154,715,1141,2103,2376,1330,807,3136,474,636,1179,694,2
54,2584,1550,1665,717,2625,1071,1315,575,913,2596,1440,798,811,3082,2161,379,1208,2202,1353,2127,1191,69
7,2317,2156,1564,431,2626,1142,607,2272,1228,2214,489,2567,2600,1324,866,723,2243,486,1573,2318,1181,123
4,3089,908,1793,1561,718,813,2689,1364,476,856,3084,1117,1411,839,1329,2571,1295,2323,1146,725,2628,2339,
698,1472,914,2107,1249,752,868,2217,2608,2162,819,2325,2204,1349,814,439,2135,929,3200,2245,1197,1578,49
0,2164,1139,1680,623,2218,1632,1336,671,1198,1362,739,1603,1557,2109,1413,916,3090,2579,1303,463,1236,84
3,2573,2690,1135,381,2329,2326,1672,1354,497,2574,2225,1586,930,821,2341,2436,726,961,3105,2139,1203,118
2,872,2632,2817,1418,492,2246,1250,1332,631,1574,1223,729,2220,1145,2168,1605,700,2249,1796,443,1307,741,
2384,1378,1562,2110,1356,1205,845,2330,1319,920,382,2191,3077,1585,822,3092,2151,1425,2226,851,1229,730,
2342,2141,1609,498,3106,880,2692,1256,742,445,2250,1392,471,635,2640,1148,2371,1696,932,2440,158

0,687,23
45,1210,1420,2818,1612,1325,1800,903,2155,1134,825,2228,1235,1361,500,3328,1577,2199,846,1670,2257,2332,
1195,745,3075,826,2696,732,1264,446,962,2142,2252,1426,1620,936,2346,2448,1377,475,853,2656,1310,867,637,
3137,2400,1551,2373,1230,2581,1414,907,2203,2258,1206,1667,2353,1588,1333,487,1808,2595,695,1441,2348,21
57,1087,746,3096,828,2232,753,1610,854,2582,1237,1326,3108,857,2585,1368,1209,504,799,2163,1355,255,964,3
138,2215,1242,909,1673,2273,1559,2374,1309,719,2354,2820,1143,477,2205,1617,915,2704,2377,1448,2158,2165 ,2260,1380,638,748,2219,944,1728,3086,2824,1331,1227,3112,869,1592,1428,491,699,2378,1253,1351,754,3201,1
183,1565,858,1618,2274,1417,2597,1476,478,3091,2586,2435,968,1260,383,2356,2264,1212,910,2464,2319,2327,
1801,815,2206,2385,1579,976,2598,2720,870,3140,2166,1684,1633,917,2380,2627,1337,1241,2588,1606,1824,312
0,727,1150,1442,493,1357,2437,1251,2221,1676,873,3085,2169,1384,701,1566,931,2601,2247,1323,1798,2832,22
27,1365,1473,756,2276,2386,1334,860,499,2360,3584,2752,731,3202,2438,1648,2222,1238,823,2602,2629,1575,3
094,922,2441,1199,1674,874,2331,1432,1421,918,2170,1636,2496,1254,502,2401,1795,933,1366,2609,1338,1682,
3144,2251,1587,1211,1488,743,2111,2388,1358,760,2442,3097,1244,1581,881,3329,2575,1147,2630,494,1379,260
4,2229,2343,1272,702,3107,921,2333,1624,501,876,2280,2172,1415,847,2253,1856,2230,1444,992,2691,1697,447,
3204,2610,1607,1436,2334,1369,2633,1257,1704,733,2347,1797,1669,2402,1340,1231,827,3093,1590,2259,934,16
34,2449,3152,2233,1474,882,3109,937,2444,2392,963,1419,747,2634,2693,1265,1119,3330,505,2641,2583,1381,8
55,924,2288,1810,734,829,3098,2254,1563,1213,2143,1611,2375,1363,2612,2848,1430,1258,2450,1688,1386,965,
2404,1614,2355,1730,2349,2465,1239,938,3208,884,2261,506,1327,3114,2616,1589,1804,3168,749,2880,1370,164
0,945,966,2636,3083,1456,1681,755,3585,2234,1266,859,1427,2694,1593,2452,1388,940,3139,2275,2944,1214,83
0,2642,2466,1809,911,2350,2697,1621,2819,1582,2408,2587,1832,871,2159,639,1480,3100,2379,1698,1335,3216,
888,2262,1372,1245,479,2357,1422,1268,3110,946,3332,1732,1677,750,1802,2236,1626,2497,1393,969,3121,2265 ,2456,508,1613,861,2657,2644,1446,1857,2599,2698,2277,1339,757,2207,2468,1382,970,2358,3141,2589,3336,28
21,1700,2658,1243,919,2705,2381,1594,1433,3113,2167,1826,1504,3146,875,1635,1259,862,1920,2648,1675,2387 ,1445,758,3232,2266,1149,948,1359,2416,2700,1816,1596,3079,2278,2439,1671,1712,977,2361,2498,1385,923,25
90,3586,2382,1622,972,3124,2281,1434,2603,1311,2822,2223,2171,1729,3203,761,2706,1396,877,2660,2389,1207 ,1475,2825,1449,2268,1812,952,2362,1686,495,1262,3153,2472,1644,1619,3116,2443,1341,1429,1825,703,2721,2
631,1371,1638,2403,3344,1567,1736,935,3142,2335,1685,2231,978,1625,2282,3099,2173,2605,883,3264,762,2708
12664,1246,503,2390,2364,1458,3205,925,2289,1394,2826,1269,878,2611,1478,735,3122,2393,1799,1678,2500,18
60,2445,1443,1637,2451,1481,1373,3160,2255,1699,1255,993,3588,2722,1591,2606,1828,2833,3148,2480,1452,88
5,3087,939,2405,2235,994,1400,3210,2284,2712,1744,1656,3360,980,2672,2635,1689,926,764,2828,3128,1270,94
1,3170,2753,1628,1367,2174,1805,2290,1457,3111,2613,2446,1921,1583,2394,2504,1387,1642,967,2406,1267,245
3,1484,2351,2617,1450,886,3592,2292,831,1683,3206,3145,2643,1342,1811,3331,947,2237,2614,1705,1431,507,2
724,3217,1261,1840,3102,889,3156,2409,1650,984,1760,2754,1490,2637,1615,751,3392,2263,2834,1702,942,2695 ,2396,1858,2467,2454,1423,2512,1460,2728,2849,1383,996,3117,2410,1692,3212,2638,1641,2457,1814,3334,971,
2618,1477,1273,3169,2836,1512,1733,3600,890,3154,1598,1374,509,1806,2645,3123,1922,2620,1649,949,3234,22
67,2359,973,1397,2756,2646,1489,1708,3337,2649,2699,2469,1627,1000,2840,2850,1690,892,2659,3095,2650,127
4,3220,2458,1438,2279,1817,2736,2701,1390,1464,3176,2296,1868,3118,950,2417,1151,1731,1506,2238,1827,241
2,1597,863,3616,2702,1451,759,1864,3143,2707,1714,1701,3209,2383,2528,1395,1803,1008,2363,2269,1623,1482 ,2418,3333,2661,1276,510,3456,2470,1435,2473,1652,2499,3125,2662,2591,3346,979,2283,2460,1492,953,2391,2
420,1928,1829,3233,2823,1389,2365,1738,763,1872,974,1453,3587,2270,1643,1713,3147,2474,1818,1215,1402,25
01,2285,1629,1520,3172,2607,3218,1830,1691,954,3340,2881,1459,2852,1734,2760,3130,2882,2709,879,3101,981 ,2856,2827,1505,3265,2665,2652,1706,3589,982,2481,2768,1924,927,2864,3149,1833,3224,288

4,1639,1447,2395,
1746,2945,1343,1679,3184,2291,1820,1761,3345,2710,1479,1275,995,3648,2502,1740,2366,1401,2723,3158,2666,
1888,765,3129,2946,2829,956,1496,3362,3268,2424,2476,1861,3594,887,2713,2784,1437,985,2615,3155,1720,3240,997,3126,2888,1630,1813,2673,1462,2286,1398,3207,2407,2505,1645,2447,2835,1848,1687,2639,1247,2726,1716,2482,2725,1936,986,3338,3590,2397,1483,3348,3150,2293,1651,1745,3236,943,2506,2714,1859,1508,3161,2668 ,3601,1834,1454,3211,891,3361,2411,1841,998,1595,2175,3115,1278,2239,766,3173,2830,2455,1465,2484,2674,1709,3266,2619,2513,1764,2729,1646,2294,2755,1737,511,3394,2398,1485,3132,2647,1404,2716,1693,3596,2838,1866,1952,3213,3368,2508,1491,3171,988,3248,2297,1657,1752,1807,2730,3712,1399,2621,1844,1001,3219,2459,2851,951,1654,3164,2837,1926,1707,3352,2757,2413,2488,1391,1002,2676,2737,1468,2422,3272,2471,1836,3604,2514,1494,2841,1873,3178,2298,2419,1271,3222,2529,2622,1694,3396,893,2461,1923,1461,3157,2651,1748,2414,1715,975,3593,1862,894,1815,3335,3103,2516,1497,1653,3618,2703,2948,1510,1762,2853,2663,1842,1375,3214,2732,3457,2758,1703,1009,3235,2477,1466,2842,1874,2300,3162,2421,2653,3280,955,2896,2738,1739,2761,2680,1486,1930,3364,2530,2854,1889,1004,3180,1658,1821,3131,2475,1718,1929,3225,2952,1599,1507,1776,3617,2462,1405,1735,3339,2271,3174,1831,1493,1010,3602,2711,1984,2740,1455,2883,3376,2667,2520,957,3185,2503,2844,1865,3237,3649,2857,2762,3296,983,2769,2885,1710,958,2764,3134,1514,3350,3400,2912,1876,1768,1721,2858,1938,1660,3221,2654,1500,3242,2960,1403,1892,3151,2770,1819,2744,1741,2425,3472,2483,1516,987,3341,3608,2865,1932,3177,3840,2367,2669,1463,3228,1012,2860,2532,1843,3393,2478,3620,1749,3186,999,3347,2886,1838,1277,2715,3267,1647,2536,3159,2287,2426,1925,2507,2670,1498,1742,3458,2675,1513,2485,1880,2428,1717,1016,3249,3656,2866,1953,3226,3342,2509,1837,1867,3591,2544,2717,1631,1469,3238,3365,2727,3188,1747,3127,767,3269,2772,1904,1724,2889,3353,1524,2677,989,3632,2399,2515,1406,3408,2486,1754,3163,2785,2299,2510,1822,2490,2489,1835,3714,2517,1499,3597,2295,1944,2731,1863,3244,3274,2890,1890,3460,3175,2786,1467,3192,1003,
3356,2947,1522,1763,3650,2718,3366,1695,2831,1850,990,3133,2897,1005,1937,3603,3241,2868,1722,3624,2776,
2976,1845,2839,2415,1495,3424,2949,3281,2678,1655,3369,2733,1765,2892,1956,3252,2681,2759,3166,2301,2739,1487,3349,2872,1750,1869,3223,2950,2734,1521,959,3716,3270,1896,1263,3464,3181,2788,1940,1770,3395,2898,2423,1877,1509,3606,2492,1711,1756,3354,2518,3215,2531,1846,1011,3595,2463,1960,2533,2953,3250,2843,2521,3288,2682,2792,1784,3664,2900,3008,1870,3370,2913,2741,1662,1013,3179,1985,3842,3398,2845,1753,1927,3273,1528,1849,1882,3652,3619,2954,1766,3300,2763,3189,1511,1954,3378,2855,1719,2522,1777,2684,3227,2742,
2302,895,3598,3713,2765,1439,3119,3363,2623,2961,3488,1006,2846,2859,1878,2427,3256,1891,3401,3239,2745,
1939,1661,3612,1502,2479,1986,3190,2655,1852,3276,2537,1934,1723,3372,2914,1772,2771,1515,2534,3621,1897,1014,3229,3282,2956,1470,3841,3609,2766,2861,1743,3412,2524,2904,1931,3165,3459,2887,3377,3343,1017,3194,2773,1968,1881,2746,3520,1894,2962,3297,2800,2916,1769,2867,1517,1778,3397,2862,2487,1941,2977,1823,3245,3626,2538,1659,3187,3728,2671,1992,1875,3680,3384,2719,1755,3246,3410,2787,3651,1501,3605,1018,3461,
2964,1900,3351,2511,3284,1725,2891,991,3183,2429,1933,3720,3402,2545,3634,2978,2869,1839,2774,3009,1525,
3251,3230,2920,1955,3466,1988,2540,1884,3298,3380,2679,3622,3271,2777,1726,3193,3653,2748,1948,1780,3844,2491,3355,2789,1518,1020,3426,3610,1767,3404,3253,2893,1905,3367,2968,2430,1851,3633,2870,1893,3473,2899,3277,2778,1945,3657,2546,1757,2928,3304,2790,2493,3440,2519,2683,1530,3196,3744,2980,1958,3628,2735,1471,1007,3258,3468,2000,3660,3373,3848,2951,1847,1898,3182,2873,1523,1942,3283,3409,2548,1961,3625,2894,
3718,1871,3243,2793,1771,2874,2780,3312,2494,3010,3474,3668,2984,1529,3425,2523,2901,3358,2915,2685,1912,3599,1758,3278,3462,2955,1989,1946,3254,3715,1526,1906,3636,3381,2535,1883,3856,2743,3489,1773,1957,3135,2794,1853,2876,1976,2801,3658,2902,1015,3285,3374,2905,3416,3257,2552,2847,3403,2303,3012,175

1,3290,2
957,3721,3607,3357,2767,1993,1503,3191,1962,2525,3665,2963,1781,3496,1885,1908,3428,2686,2796,2016,2992,
3776,1854,3379,3275,2917,1532,3640,3476,2539,2747,1972,3301,3399,2802,1774,3231,3613,2906,3666,3465,101
9,3524,2526,1895,3016,3308,1987,2431,3260,2958,1969,3849,2863,1782,3627,3024,1279,2918,1943,3732,3681,29
65,1899,3385,3289,1994,1663,3654,3872,2775,3198,3490,2541,3405,1964,3299,3724,2921,1785,3432,2749,3614,2
979,1021,3371,3846,1935,3413,3521,2804,3382,2908,2547,1886,2779,2001,3696,3286,2871,1407,3623,1779,2970,
3247,3722,2922,3480,3469,2966,1990,3684,3302,2550,1970,3843,2981,3414,1879,1022,3386,3730,3635,3259,353
6,2791,1902,3406,2808,1947,3292,3629,2929,3195,2542,3427,1759,3320,2750,1907,2969,3672,2549,2924,3463,28
95,1527,3904,3492,3040,3745,2495,1996,3655,3484,1786,3417,3305,3752,2781,1959,2002,3845,3717,1913,3388,3
279,2875,1949,3638,2982,3682,2017,3522,2930,1534,2985,3011,3467,2795,3313,3167,2553,3429,2903,2972,3858,
2782,2877,1788,3611,3261,3659,3411,1910,1965,3478,3306,2004,3736,3434,3013,1901,3662,3778,1966,1775,328
7,2986,2932,2008,2554,3375,3637,3852,2797,3418,3688,2993,3014,3504,3729,2803,1531,3314,2907,3475,3641,34
36,2988,1971,3262,1950,2878,3857,2959,1909,3669,3630,1991,3880,2919,2018,2687,3528,1727,3746,3383,2936,1
916,3420,3293,2527,1855,3470,3316,2994,3780,3725,2798,3850,3674,3441,3017,1974,2556,3661,2909,3494,3905,
1995,3387,2805,3430,3018,2020,1977,3748,3291,2967,1787,3642,3481,1914,3874,3552,2923,3683,3307,2910,396
8,2005,3723,3493,2806,1887,3197,2996,3407,1023,3864,3644,3719,3760,3025,3433,2971,1963,3670,3020,3482,33
59,1998,3777,1783,2809,3444,2925,3255,3523,2024,3497,3860,3000,3734,2543,3310,1980,3692,3667,3389,3477,3
873,2751,1903,3419,3686,1973,3615,3784,2983,3733,3026,3673,2003,2931,1789,2810,3294,2551,3506,2973,3442,
3317,2926,3526,2783,1997,3847,3726,3908,3491,3685,2032,1978,3529,3421,3747,3303,3041,1917,3639,3876,201
0,3500,2933,2987,3042,3448,3792,3704,3028,3737,2974,2812,3318,2989,1519,3676,3415,3853,3505,2019,3969,36
31,2006,3435,3690,3015,1951,3315,3532,1911,3498,2934,2021,2879,3731,3390,3859,2995,3753,3479,2555,3309,3
888,2937,3698,3032,3808,3538,3663,2799,2009,3750,2990,3906,1790,3471,3508,3431,3044,2026,3740,1975,3689,
3862,3019,2012,3525,3321,3560,3781,2938,3646,3422,2557,3854,3970,3697,2997,1967,3021,3445,3537,3756,367
5,3048,3738,2940,1915,3322,3486,3865,2025,3438,3512,2022,3916,2998,3199,3779,3554,1981,3875,3645,2911,34
99,2807,3912,3762,3749,3443,3851,3056,3671,3530,1918,3324,2558,3483,3700,2033,1999,3027,3540,3001,3976,3
877,3437,3786,2811,3920,3022,3501,2028,3691,3761,3866,3263,3450,1533,3677,3568,3878,3739,3002,3507,3782,
2011,2927,3029,3553,3754,3030,3972,2975,3881,1982,3687,3495,3794,3391,3727,2034,3868,3809,3527,3323,304
3,1979,3788,3449,2023,3936,2813,3004,3544,3909,2935,3485,3033,3768,3045,3678,3861,3510,3446,2013,3693,38
96,3735,2036,3295,3764,3984,3034,2007,3531,3699,3793,2991,3907,3556,3882,3502,2939,3889,3046,3643,3326,2
814,2030,3513,3757,3812,3694,3785,2559,2014,3533,3452,3741,2040,3914,4000,3539,3036,3705,3800,3855,3447,
3892,3049,2999,3702,3974,3755,3439,3050,3516,1535,3884,3542,3921,2027,3319,2029,3742,2941,3971,3509,379
6,3763,3023,3910,2942,3863,3545,3701,3558,3810,3890,3423,3751,3057,3514,3922,2035,3003,3787,3534,3978,39
37,3052,3706,3869,2037,3766,3977,3647,3555,3824,3453,3783,3879,3541,3058,4032,3503,1791,3005,3913,3031,3
758,3006,3562,3924,3816,3769,3986,3708,2038,3548,3451,3940,2041,3867,3789,3564,3035,3980,3511,3060,3891,
3797,3047,3886,3325,3695,1919,3973,3546,3790,3561,3928,3765,3064,2042,4001,3885,3915,3679,3517,3795,281
5,3952,3772,3572,3037,3454,3802,3870,3883,2039,3547,3992,3911,2044,3938,3515,3051,3570,3811,3743,3898,30
38,3053,3985,3770,3893,3543,3703,3813,4004,2043,3535,3798,3917,3569,3007,3944,3311,3988,3818,3925,3557,3
759,3804,3894,3059,4008,2031,3832,3918,3710,3061,4033,3801,3975,3576,3897,3930,3814,3559,4002,3767,3825,
2943,3487,3054,3926,3939,3987,3709,3550,4034,1983,3900,3982,3771,3820,3563,3945,3062,3518,3791,3979,306
5,4016,3929,3942,3817,3565,3826,3989,3871,2046,3

707,4040,3923,3803,3549,3066,3948,3773,3039,3981,3887,35 73,4003,4036,3932,2047,3774,3996,3828,3566,3068,3815,3953,3899,3941,3993,3805,2015,3578,4006,3519,3055,4 048,3895,3946,3571,3990,4009,3919,3819,3577,3960,3806,4037,3994,3574,3954,3931,3821,4005,3901,4024,3063, 3799,4041,3551,4010,3829,3933,3956,4064,3902,3580,4020,3822,3067,3943,4035,4017,3830,3327,3991,3947,404 2,3711,4012,3833,3069,3983,3934,4049,3455,3827,2045,4038,4018,3927,3070,3950,3995,3807,3955,3575,4044,38 34,4007,4050,3961,3997,4065,3582,3836,3958,4013,4052,3949,4014,3823,4056,3579,4019,3998,3957,4039,4066,3 775,3964,3903,4022,4043,4068,4025,3835,3962,4053,3935,3071,4011,4046,3831,4072,4028,3951,4021,4051,3837, 4045,4080,4026,3965,4058,3567,4067,4054,3999,3959,4069,4057,3838,4074,4023,4060,4015,3963,4073,4070,402 9,3966,4081,4047,4076,3581,4059,4030,4082,4027,4071,4061,4084,4055,4078,4062,4088,3583,4075,4077,4083,40 85,3839,4086,4089,3967,4090,4087,4092,4091,4079,4031,4094,4095,4063,4093]

**Sequence group 5: Z5_4096**

[0,1,2,7,3,8,11,24,4,10,13,28,16,33,35,77,5,12,14,32,19,38,47,81,22,46,42,88,57,96,102,168,6,17,21,40, 23,45,51,90,29,55,59,97,72,111,117,187,34,61,75,115,80,124,134,199,87,136,147,226,152,238,259,382,9,18,26,54, 30,58,71,105,36,76,62,118,84,128,141,208,44,74,86,135,92,144,151,232,100,154,170,250,185,267,286,425,53,89,9 8,150,112,161,179,264,122,180,198,278,210,302,320,462,138,206,229,308,235,321,346,494,256,355,375,519,395,5 44,588,818,15,25,31,73,39,79,82,140,48,85,93,149,101,159,165,261,56,94,103,162,116,178,195,281,127,196,207,2 96,231,316,340,482,64,109,123,184,129,197,214,310,148,227,236,323,255,353,367,518,163,246,265,359,279,390,3 98,541,304,412,445,575,471,609,678,820,69,125,143,217,158,234,253,357,169,257,270,381,287,397,424,565,193,2 82,297,409,322,437,466,621,336,474,501,650,527,689,716,943,213,311,330,451,360,481,506,668,394,514,542,704, 577,721,786,1018,421,553,589,755,604,806,835,1077,673,852,881,1066,915,1125,1203,1490,20,37,41,91,49,95,10 6,177,50,107,119,188,131,209,218,338,63,120,132,223,145,230,244,339,153,243,260,373,283,393,403,540,67,142, 155,225,173,247,266,391,182,276,288,405,301,434,456,600,181,298,314,433,335,467,485,651,362,508,528,688,55 0,712,762,997,78,167,174,273,191,294,312,426,200,319,327,464,347,492,512,686,258,341,361,499,383,524,549,70 7,415,559,595,751,624,803,839,1056,293,377,406,536,432,574,598,789,459,615,634,816,679,866,892,1108,503,67 6,691,882,708,917,872,1144,772,988,1019,1219,1030,1318,1369,1550,83,189,194,334,248,352,366,507,274,371,38 4,533,414,561,593,792,289,410,430,563,448,599,628,824,475,637,667,858,705,888,940,1156,337,435,454,627,483, 659,696,874,531,697,718,934,773,912,1004,1229,572,742,798,990,826,1028,1061,1285,867,1070,1069,1356,1147, 1390,1432,1688,376,472,509,699,560,720,761,956,596,790,808,1022,848,1037,1067,1312,629,832,877,1057,898,1 074,1151,1393,953,1163,1199,1442,1256,1505,1544,1823,687,884,928,1153,1001,1158,1243,1463,1015,1236,1292 ,1529,1341,1583,1664,1935,1040,1323,1384,1609,1417,1675,1637,1972,1486,1728,1765,2076,1842,2132,2209,240 6,27,43,52,99,60,121,133,215,66,137,146,222,157,241,245,387,68,156,166,240,175,295,305,420,202,307,333,460,3 49,487,510,702,70,172,190,300,204,331,343,479,216,356,368,515,389,545,569,723,228,379,402,556,428,592,610,7 77,439,601,639,831,648,856,885,1211,110,203,211,348,224,369,388,535,251,404,416,581,442,618,636,796,272,41 9,453,607,477,646,654,841,498,657,665,891,739,918,979,1232,290,476,490,663,523,693,701,904,548,738,765,952, 811,998,1023,1296,580,785,827,1027,868,1053,1114,1345,925,1122,1166,1394,1200,1447,1516,1812,113,220,242, 399,269,417,447,623,285,457,480,658,504,671,681,900,318,491,521,684,547,732,758,947,578,775,809,1013,842,1 041,1092,1300,344,534,568,763,611,799,797,1044,630,833,854,1078,907,1118,1134,1402,670,869,921,1126,949,1 176,1202,1466,987,1225,1270,1530,1353,1593,1670,1946,364,586,617,836,653,865,909,1123,729,924,962,1192,96 8,1207,1252,1501,743,965,986,1241,1049,1267,1331,1580,1104,1348,1380,1613,1430,1698,1736,1985,776,1065,1 085,1303,1141,1358,1389,1650,1167,1426,1471,1722,1517,1772,1832,2092,1275,1475,1534,1782,1604,18

53,1885,
2189,1654,1920,1968,2234,2030,2312,2389,2668,130,252,277,458,315,489,517,711,325,526,554,735,582,769,823,
1094,358,570,622,793,641,862,845,1107,660,878,913,1162,957,1182,1215,1487,429,631,661,859,728,903,929,119
7,734,961,976,1216,1000,1253,1284,1559,745,994,1034,1280,1101,1328,1373,1619,1130,1413,1428,1705,1473,17
37,1797,2063,441,727,731,950,749,966,1010,1261,782,1051,1082,1314,1119,1365,1421,1680,920,1097,1143,1378,
1171,1443,1477,1732,1257,1482,1538,1786,1608,1844,1879,2185,973,1175,1240,1446,1276,1526,1566,1810,1337,
1589,1628,1876,1676,1923,1982,2266,1386,1659,1715,1966,1763,2012,2060,2324,1819,2082,2128,2379,2158,247
2,2484,2837,452,752,768,1089,901,1112,1133,1410,937,1160,1189,1455,1249,1495,1554,1801,982,1212,1272,150
8,1308,1571,1632,1866,1368,1672,1624,1904,1733,1977,2029,2281,1105,1287,1327,1595,1399,1640,1709,1955,14
38,1717,1761,2014,1792,2034,2097,2368,1519,1776,1828,2071,1889,2139,2176,2439,1932,2224,2256,2516,2316,2
560,2574,2762,1172,1332,1433,1720,1491,1753,1777,2052,1548,1838,1857,2119,1909,2143,2236,2481,1563,1900,
1960,2220,2025,2268,2277,2570,2086,2328,2357,2603,2424,2677,2721,2947,1685,2002,2017,2302,2109,2333,238
3,2623,2154,2435,2450,2710,2528,2724,2847,3024,2200,2505,2550,2786,2614,2807,2878,3093,2647,2897,2938,31
47,2986,3190,3225,3405,139,114,65,284,104,262,183,505,126,186,205,443,221,354,324,573,160,219,239,332,263,
408,370,664,303,385,423,543,463,733,613,897,171,249,268,392,306,413,468,591,326,493,438,819,532,633,674,12
09,350,473,558,647,513,700,781,1046,583,767,730,933,840,1096,969,1470,201,292,309,450,345,486,539,683,380,
606,495,717,571,746,805,985,411,530,644,778,614,890,764,1017,564,810,916,1064,861,1259,1124,1726,440,640,5
85,849,722,822,944,1084,672,995,880,1178,931,1140,1412,1317,754,955,1007,1294,1045,1193,1231,1504,1086,13
50,1266,1662,1396,1888,1581,2178,233,328,365,520,401,552,605,788,436,685,576,813,635,846,906,1152,465,612,
724,857,666,978,883,1132,748,936,1035,1201,999,1246,1336,1536,500,710,649,911,807,959,1042,1224,780,1100,
980,1425,1080,1290,1301,1626,851,1032,1161,1335,1121,1364,1458,1926,1220,1485,1404,1648,1553,1741,1796,2
245,546,737,830,1014,771,1048,1137,1347,873,1185,1081,1524,1234,1379,1452,1704,919,1113,1247,1415,1313,1
479,1618,1760,1165,1575,1494,1865,1657,1822,1971,2351,964,1274,1343,1586,1190,1532,1636,2001,1388,1696,1
749,1878,1549,2079,1936,2766,1431,1725,1785,2054,1826,1981,2033,2466,1669,2122,2162,2301,2208,2627,2387,
3163,280,386,418,608,469,692,638,896,488,656,801,941,726,992,1036,1264,537,756,703,1009,804,1128,971,1311,
864,1052,1149,1357,1088,1500,1445,1914,579,815,770,1210,927,1043,1093,1367,847,1117,1174,1598,1239,1408,
1480,1766,951,1262,1196,1523,1344,1462,1607,1817,1299,1574,1643,1852,1703,1943,2068,2292,620,1003,838,11
42,886,1283,1181,1533,972,1222,1322,1489,1363,1584,1653,1890,1060,1416,1302,1745,1255,1602,1641,2038,148
4,1694,1774,1949,1821,1997,2131,2499,1111,1441,1360,1665,1515,1731,1856,2108,1592,1903,1752,2050,1791,22
31,2170,2449,1392,1837,1979,2198,1922,2144,2341,2432,2018,2307,2246,2592,2412,2543,2681,3206,695,908,102
6,1260,1083,1307,1454,1679,1139,1541,1340,1721,1405,1631,1825,2103,989,1376,1436,1787,1528,1944,1748,207
5,1630,1870,1912,2212,1692,2327,2165,2841,1214,1467,1582,1993,1684,1884,1847,2288,1511,1929,2059,2188,20
11,2237,2377,2555,1780,2042,1975,2259,2105,2475,2339,2612,2171,2393,2508,2708,2453,2661,2882,3023,1271,1
603,1714,1927,1543,2121,1984,2300,1813,1996,2204,2361,2056,2409,2522,2753,1649,2147,2089,2422,2223,2549,
2460,2736,2317,2489,2638,2695,2589,2936,2860,3112,1874,2271,2180,2539,2372,2776,2494,2826,2125,2642,257
7,2874,2602,2911,2985,3493,2250,2761,2713,3036,2675,2960,3074,3252,2816,3057,3016,3329,3132,3617,3281,37
17,363,444,511,715,567,741,802,1039,603,894,774,1155,844,1076,1205,1450,642,812,946,1099,876,1305,1146,14
98,993,1251,1361,1740,1228,1537,1594,1953,680,939,899,1188,1005,1244,1346,1622,1103,1419,1291,1562,1401,
1658,1806,2047,1055,1372,1326,1647,1461,1769,1707,2005,1527,1789,1869,2384,1894,2184,2130,2538,760,960,1
091,1304,1187,1352,1577,1691,1033,1383,1476,1743,1407,1843,1755,2091,1170,1507,1539,1940,1437,1804,1908,
2203,1674,1961,1835,2153,2037,2249,2336,2660,1298,1570,1710,1877,1634,1994,1950,2287,1775,2115,2051,224
0,1939,2345,2402,2630,1616,2138,2085,2365,2214,2490,2440,2741,2023,2427,2530,2922,2586,2858,2806,3173,85
5,1206,1073,1459,1136,1701,1422,1898,1321,1496,1627,1882,1588,1831,1989,2293,1295,1781,1644,2064,1569,19
58,1934,2349,1751,2028,2157,2255,2112,2414,2470,2718,1398,1687,1816,2000,1863,2194,2096,2504,1697,2074,2
275,2444,2148,2396,2573,2779,1899,2241,2193,2480,2353,2646,2534,2830,2331,2583,2729,2869,2672,2945,2975,
3351,1520,1918,1757,2179,1830,2126,2261,2544,1954,2405,2233,2519,2305,2598,2639,2887,2022,2366,2290,266
6,2478,2621,2756,3104,2428,2813,2684,2931,2780,3008,3066,3242,2087,2297,2495,2714,2400,2744,2822,2989,25
82,2909,2771,3048,2872,3083,3141,3312,2540,2832,2912,3208,2980,3118,3160,3420,2798,3185,3261,3386,3295,3
452,3533,3766,996,1250,1180,1639,1355,1700,1599,1988,1409,1558,1833,2199,1770,2040,2133,2429,1464,1800,1
735,2069,1931,2337,2117,2485,1893,2167,2244,2596,2296,2531,2689,2918,1578,1945,1873,2182,2007,2228,2254,
2548,1809,2284,2376,2692,2457,2655,2626,2957,2080,2382,2498,2617,2434,2733,2785,3032,2348,2817,2720,299
7,2865,3087,3128,3359,1682,1848,2100,2371,1991,2322,2483,2700,2190,2564,2417,2656,2174,2757,2802,3045,22
35,2462,2510,2927,2581,2775,2850,3224,2644,2901,2818,3079,2968,3120,3200,3401,2311,2527,2704,2853,2593,3
000,2904,3150,2765,2877,3033,3169,2941,3308,3232,3440,2671,2993,3075,3245,3121,3342,3300,3508,3064,3270,
3389,3566,3355,3476,3593,3796,1880,2046,2136,2474,2280,2635,2443,2814,2227,2535,2523,2891,2607,2950,286
8,3193,2356,2725,2585,2857,2770,2916,3037,3165,2698,3005,3071,3235,2979,3274,3338,3505,2418,2651,2827,29
64,2746,3084,3020,3266,2789,3041,3114,3413,3181,3301,3311,3557,2900,3157,3220,3336,3137,3443,3370,3540,3
089,3382,3470,3646,3433,3579,3634,3883,2553,2809,2862,3153,2966,3070,3216,3345,2926,3111,3172,3376,3258,
3463,3418,3599,3027,3202,3267,3450,3304,3397,3501,3673,3316,3529,3479,3625,3544,3664,3695,3931,3
125,327
8,3348,3498,3381,3511,3573,3649,3426,3570,3538,3721,3611,3723,3688,3858,3469,3598,3640,3744,3668,3753,37
78,3820,3699,3782,3804,3841,3824,3987,3903,3919,108,164,176,271,192,275,313,431,212,299,329,461,372,497,5
16,747,237,317,342,496,396,529,590,759,422,587,557,794,645,829,860,1098,254,374,407,551,427,584,616,800,47
0,632,655,834,719,893,922,1159,502,669,740,910,757,942,977,1194,791,983,1024,1273,1047,1306,1362,1651,291,
378,449,626,478,652,714,871,522,744,675,923,783,958,1008,1223,566,736,787,981,817,1016,1038,1286,850,1054,
1106,1334,1154,1382,1434,1742,625,795,837,1031,895,1072,1131,1375,935,1135,1191,1411,1227,1469,1512,1811,
991,1218,1279,1488,1293,1513,1568,1872,1351,1591,1633,1917,1678,1964,2039,2385,351,446,484,725,538,753,7
66,1006,594,784,821,1029,853,1068,1087,1370,643,825,863,1075,914,1129,1183,1420,954,1184,1221,1456,1282,1
506,1560,1854,682,887,938,1150,963,1186,1235,1493,1025,1277,1297,1518,1349,1587,1617,1916,1079,1325,1377 ,1601,1414,1667,1683,1959,1474,1713,1784,2016,1834,2072,2181,2388,709,945,1012,1242,1063,1289,1342,1597,
1102,1354,1391,1646,1435,1681,1739,1999,1177,1423,1457,1708,1514,1764,1820,2094,1552,1840,1887,2141,193
0,2202,2239,2546,1233,1497,1540,1794,1605,1851,1896,2166,1677,1911,1962,2221,2020,2248,2340,2633,1734,19
78,2041,2295,2062,2364,2403,2697,2173,2426,2464,2687,2511,2751,2836,3102,400,525,555,814,597,828,875,112
7,602,879,926,1164,970,1226,1245,1556,677,930,974,1265,1020,1281,1320,1557,1050,1319,1366,1629,1424,1673,
1693,1957,698,1011,1058,1269,1115,1329,1381,1668,1145,1403,1439,1699,1468,1758,1802,2057,1138,1460,1502,
1756,1551,1824,1858,2142,1610,1901,1933,2201,1974,2232,2306,2610,750,1095,1116,1397,1173,1451,1499,1744,
1195,1510,1531,1815,1572,1868,1907,2196,1359,1561,1606,1883,1652,1925,1973,2225,1719,1987,2048,2289,209
9,2360,2408,2679,1449,1638,1702,1951,1754,2015,2053,2343,1807,2084,2111,2381,2183,2447,2479,2735,1891,21
77,2205,2465,2226,2513,2454,2774,2320,2599,2634,2851,2645,2949,2996,3154,779,1168,1179,1547,1330,1585,16
15,1897,1400,1625,1655,1942,1718,1992,2045,2346,1440,1711,1750,1995,1790,2055,2102,2392,1841,211
6,2164,2
437,2222,2473,2542,2788,1555,1759,1799,2101,1855
,2152,2211,2456,1938,2213,2243,2533,2321,2507,26
19,2861,
2010,2278,2354,2601,2394,2643,2683,2915,2448,269
1,2690,2982,2778,3012,3052,3257,1635,1836,1902,2
215,199
0,2247,2304,2562,2049,2344,2369,2636,2421,2654,2
688,2943,2104,2399,2459,2680,2488,2694,2782,3014
,2559,27
94,2831,3059,2889,3115,3149,3358,2197,2468,2525,
2784,2616,2790,2875,3078,2631,2867,2921,3135,296
7,3179,3
240,3431,2658,2953,3007,3199,3040,3248,3219,3455
,3099,3288,3317,3519,3371,3552,3595,3694,455,562,
619,843 ,662,932,975,1237,694,984,1021,1263,1062,
1315,1324,1661,706,1059,1090,1310,1120,1453,1478
,1730,1204,1483,
1546,1808,1576,1860,1905,2218,713,1110,1169,1465
,1213,1542,1564,1849,1238,1596,1620,1913,1666,19
65,2006,
2252,1278,1642,1690,1983,1746,2044,2073,2329,176
8,2058,2120,2398,2137,2433,2469,2844,889,1208,12
30,1573,
1268,1621,1663,1948,1338,1695,1723,2027,1778,209
0,2114,2350,1395,1729,1798,2067,1846,2134,2146,2
411,188
1,2150,2161,2477,2274,2514,2588,2864,1444,1845,1
864,2159,1924,2207,2217,2497,1970,2273,2310,2558
,2374,26
11,2637,2925,2026,2338,2395,2641,2451,2676,2740,
2971,2521,2748,2796,3015,2833,3063,3123,3349,902
,1254,13
16,1686,1387,1724,1788,2098,1429,1803,1850,2151,
1892,2169,2187,2492,1509,1867,1921,2192,1969,226
5,2299,2
552,2021,2325,2370,2628,2413,2659,2716,2930,1565
,1947,2004,2308,2077,2355,2352,2664,2106,2401,24
30,2699,
2501,2743,2760,3022,2168,2452,2518,2752,2554,280
5,2835,3081,2597,2856,2902,3136,2978,3187,3244,3
439,161
2,2036,2088,2404,2145,2446,2503,2749,2262,2520,2
568,2824,2575,2840,2885,3110,2279,2571,2595,2873
,2670,28
99,2958,3176,2731,2974,3004,3201,3050,3265,3293,
3462,2326,2686,2707,2934,2769,2984,3011,3231,279
7,3047,3
086,3285,3124,3321,3365,3528,2907,3090,3140,3328
,3196,3378,3400,3584,3234,3421,3453,3607,3490,36
51,3687,
3811,967,1339,1406,1805,1503,1862,1915,2230,1522
,1928,1980,2270,2031,2315,2391,2719,1600,2008,20
95,2347,
2124,2442,2416,2734,2155,2461,2509,2793,2563,281
2,2848,3100,1747,2107,2156,2438,2260,2496,2526,2
829,226
9,2567,2584,2849,2615,2886,2914,3159,2282,2606,2
650,2910,2728,2956,2999,3205,2755,3035,3049,3273
,3088,32
94,3339,3512,1773,2258,2264,2556,2286,2572,2625,
2894,2335,2673,2703,2946,2745,2992,3043,3251,251
7,2723,2
773,3002,2800,3060,3092,3290,2890,3096,3144,3331
,3198,3373,3395,3582,2580,2804,2871,3062,2908,31
31,3164,
3347,2963,3184,3212,3392,3249,3423,3460,3626,300
9,3238,3280,3451,3315,3481,3510,3655,3354,3522,3
549,368
2,3565,3725,3732,3874,1795,2291,2314,2712,2493,2
738,2759,3031,2537,2791,2821,3069,2881,3106,3156
,3341,25
91,2845,2905,3117,2940,3168,3215,3385,2995,3246,
3209,3412,3291,3457,3489,3632,2732,2917,2955,318
9,3019,3
222,3276,3446,3056,3282,3314,3482,3335,3492,3531
,3677,3126,3324,3362,3516,3403,3556,3575,3710,34
29,3602,
3622,3745,3652,3767,3771,3846,2801,2959,3053,328
3,3103,3307,3325,3504,3151,3369,3380,3543,3415,3
558,360
9,3730,3162,3410,3448,3600,3487,3627,3630,3769,3
524,3657,3672,3786,3703,3815,3832,3912,3255,3475
,3483,36
45,3537,3659,3684,3792,3563,3709,3715,3827,3750,
3833,3876,3935,3590,3741,3763,3856,3789,3862,389
0,3956,3
803,3894,3909,3969,3924,3981,3991,4030,1002,905,
690,1427,870,1371,1148,1895,948,1157,1217,1779,1
258,1590 ,1521,2013,1071,1248,1309,1545,1374,170
6,1623,2160,1472,1656,1738,1963,1814,2267,2081,2
487,1109,1333,138
5,1671,1481,1716,1827,2043,1525,1871,1767,2386,1
941,2110,2175,2842,1579,1839,1986,2135,1910,2216
,2334,26
67,2032,2313,2263,2532,2410,2722,2576,3085,1198,
1448,1492,1793,1567,1859,1956,2191,1645,2066,187
5,2242,2
009,2283,2363,2594,1712,1937,2129,2330,2083,2476
,2309,2632,1998,2373,2512,2685,2441,2892,2750,32
87,1771,
2123,2035,2423,2251,2390,2547,2706,2172,2608,246
3,2808,2529,2768,3034,2948,2294,2561,2622,2923,2
665,282
5,2863,3113,2709,2976,2898,3239,3017,3402,3177,3
576,1288,1535,1614,1919,1689,1976,2065,2342,1762
,2195,20
19,2378,2113,2419,2500,2783,1818,2078,2253,2436,
2163,2587,2467,2758,2285,2536,2652,2834,2613,287
9,2962,3
142,1886,2229,2140,2506,2367,2565,2662,2855,2332
,2727,2590,3046,2701,2919,2932,3210,2425,2648,27
92,2961,
2747,2991,3072,3424,2852,3098,3025,3229,3155,329
7,3337,3615,1967,2272,2397,2629,2319,2669,2764,2

973,245 5,2815,2702,3130,2866,3003,3067,3272,2515,2739,2 880,3038,2944,3094,3204,3313,2795,3171,3105,3384 ,3236,33 57,3454,3669,2569,2906,2969,3182,2823,3138,3218, 3474,3010,3263,3303,3394,3152,3520,3432,3848,305 1,3286,3 330,3506,3361,3459,3491,3722,3243,3546,3567,3644 ,3594,3794,3686,3974,1418,1660,1727,2070,1829,22 06,2118, 2486,1861,2149,2358,2545,2257,2604,2653,2896,195 2,2298,2219,2624,2362,2754,2578,2942,2445,2674,2 781,298 3,2711,3109,3061,3417,2024,2380,2318,2843,2524,2 663,2717,2994,2420,2742,2803,3191,2870,3029,3095 ,3318,25 57,2895,2828,3129,2970,3077,3197,3353,2929,3170, 3226,3377,3271,3436,3514,3638,2093,2618,2407,277 2,2471,2 913,2811,3139,2579,2854,2952,3101,2990,3180,3233 ,3404,2682,3039,2933,3299,2888,3194,3223,3495,30 97,3262, 3322,3441,3356,3472,3551,3739,2737,3058,2987,324 1,3122,3289,3379,3536,3186,3411,3306,3502,3334,3 605,357 1,3714,3013,3368,3458,3588,3422,3559,3663,3707,3 484,3648,3616,3780,3697,3759,3816,3985,2210,2502 ,2640,28 93,2705,2939,3068,3250,2767,3146,2965,3 284,3026,3 214,3 360,3 534,2600,300 1 ,3054,3 3 3 2,3134,343 7,3302,3518,3 213,3388,3416,3596,3260,3656,3568,3875,2846,3082 ,3178,3467,3254,3399,3374,3636,3119,3427,3509,35 83,3480, 3610,3681,3765,3326,3497,3456,3623,3535,3727,366 2,3788,3572,3689,3742,3826,3716,3809,3891,3934,2 903,319 5,3279,3425,3148,3545,3461,3643,3350,3471,3592,3 674,3507,3696,3747,3842,3230,3560,3526,3702,3601 ,3762,37 19,3837,3653,3734,3798,3821,3779,3908,3881,3959, 3391,3628,3578,3757,3679,3852,3736,3870,3547,380 0,3772,3 888,3785,3899,3923,4045,3619,3845,3828,3939,3814 ,3915,3949,3996,3866,3944,3932,4013,3966,4065,40 04,4077, 1611,1783,1906,2238,2003,2276,2359,2657,2061,248 2,2323,2787,2415,2696,2838,3065,2127,2375,2551,2 726,245 8,2937,2777,3108,2605,2884,2988,3296,2859,3143,3 188,3444,2186,2541,2491,2820,2620,2876,2972,3207 ,2730,30 42,2920,3161,3021,3237,3344,3500,2678,2998,2954, 3228,3076,3319,3275,3477,3133,3333,3387,3685,340 7,3581,3 550,3756,2303,2566,2715,2935,2819,2977,3174,3259 ,2649,3006,3091,3298,3028,3372,3309,3527,2799,31 16,3145, 3435,3055,3343,3414,3591,3247,3449,3367,3562,349 4,3618,3660,3808,2928,3167,3277,3393,3217,3468,3 442,363 5,3323,3541,3503,3612,3434,3665,3692,3795,3203,3 555,3523,3675,3597,3735,3711,3838,3486,3704,3751 ,3904,37 77,3880,3861,3978,2431,2839,2693,3073,2763,3269, 3044,3408,2951,3107,3211,3398,3183,3364,3465,363 9,2924,3 327,3227,3513,3166,3447,3430,3667,3305,3488,3564 ,3621,3539,3698,3724,3830,3018,3256,3352,3473,33 83,3587, 3530,3740,3264,3517,3629,3713,3561,3690,3770,385 3,3409,3613,3586,3729,3670,3802,3754,3872,3658,3 775,383 5,3886,3813,3911,3920,4019,3127,3419,3310,3577,3 363,3548,3624,3760,3445,3693,3606,3746,3647,3784 ,3799,38 92,3485,3676,3637,3810,3728,3791,3843,3957,3705, 3864,3817,3907,3854,3930,3946,3994,3525,3642,373 7,3829,3 691,3839,3869,3925,3774,3898,3850,3943,3887,3952 ,3968,4011,3758,3873,3900,3986,3922,3961,3973,40 33,3859, 3980,3998,4026,4005,4039,4052,4082,2609,2883,281 0,3221,2981,3268,3192,3464,3030,3158,3366,3589,3 320,349 6,3553,3706,3080,3340,3292,3515,3428,3661,3542,3 733,3406,3569,3614,3783,3641,3752,3818,3902,3175 ,3438,33 90,3580,3478,3604,3620,3761,3346,3633,3680,3819, 3718,3806,3793,3914,3521,3683,3738,3790,3708,383 6,3855,3 937,3666,3867,3831,3927,3884,3954,3965,4021,3253 ,3375,3532,3678,3466,3654,3731,3823,3585,3768,37 00,3807, 3574,3844,3860,3942,3608,3720,3743,3906,3773,385 1,3877,3990,3801,3896,3868,3951,3918,3962,3983,4 029,365 0,3749,3825,3878,3781,3928,3897,3970,3847,3889,3 938,3976,3910,4009,3992,4036,3812,3926,3950,3995 ,3963,40 16,4006,4049,3945,4001,4027,4057,4020,4043,4061, 4085,3396,3499,3554,3726,3631,3797,3712,3865,360 3,3755,3 748,3893,3787,3913,3885,3982,3671,3834,3776,3879 ,3849,3901,3940,3975,3822,3929,3948,3993,3921,40 02,4015, 4048,3701,3805,3871,3916,3840,3953,3933,3999,385 7,3941,3960,4031,3979,4007,4010,4056,3895,3972,3 989,401 4,3967,4037,4022,4054,3955,4025,4042,4069,4035,4 060,4067,4091,3764,3863,3882,3971,3917,3947,3988 ,4017,39 05,3958,3977,4023,3997,4040,4032,4063,3936,3984, 4000,4038,4008,4028,4047,4073,4012,4051,4044,406 6,4055,4 071,4075,4094,3964,4003,4018,4046,4024,4050,4059 ,4070,4034,4058,4053,4078,4064,4079,4074,4090,40

41,4062,4068,4080,4072,4081,4083,4087,4076,4084,4086,4089,4088,4095,4092,4093]

**Sequence group 5: Q5_8192**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1026,520 ,288,528,192,544,70,44,131,81,50,73,15,320,133,52,23,134,384,76,137,82,56,27,97,39,259,84,138,145,261,29,43,98,515,88,140,30,146,1028,71,262,265,2048,161,576,45,100,640,1025,51,148,46,75,266,273,517,104,162,53,193,1032,152,77,164,768,268,274,518,54,83,57,521,112,1024,135,78,289,194,85,276,522,58,168,139,99,86,60,280,89,290 ,529,524,196,141,1040,101,147,176,2049,142,530,321,31,200,90,1056,545,292,322,532,2050,263,149,102,105,304,4096,296,1030,163,92,1033,47,267,385,546,324,2052,208,386,150,153,165,106,55,328,1088,536,577,548,1034,113 ,154,79,269,108,578,2056,224,166,519,552,195,270,1041,641,1036,523,275,580,291,59,169,560,114,277,156,87,1152,197,116,170,2064,61,1042,531,525,642,281,278,526,177,293,388,1057,91,584,769,198,2080,172,120,201,336,62,282,4097,143,1029,1044,103,178,294,93,1058,644,202,2051,592,323,392,2053,297,770,4098,107,180,1280,151,209,284,1027,648,94,204,298,400,608,2112,1089,352,325,533,155,210,305,2057,4100,547,300,109,1048,184,534,1060,537,115,1090,167,225,326,2054,306,772,157,2065,656,329,110,117,212,171,1038,776,1064,4104,330,1153,2058,226,549,1043,538,387,308,216,416,271,279,158,337,2066,550,672,1092,118,332,579,540,1072,2176,389,173,1037,121,553,199,784,179,228,4112,338,312,1536,704,1154,390,174,554,581,1046,393,2060,283,2081,122,448,353,2113,561,1096,203,63,4128,340,394,1049,1281,527,582,556,181,295,1059,285,232,124,2068,205,182,643,2304,1156,562,286,585,4099,299,354,2082,1045,4101,211,401,1104,185,1061,396,344,586,645,1282,593,535,240,2072,1050,206,95,327,2084,564,800,402,2055,4160,356,307,301,417,1160,213,1066,568,1120,832,4105,588,1035,1537,186,2177,646,404,2114,1091,227,896,594,418,2560,302,649,771,360,539,2059,4102,111,1052,331,1168,4113,214,309,1062,1284,2088,188,449,1073,217,408,609,596,2116,551,650,229,159,4106,420,2178,310,1093,541,1288,773,610,657,333,1065,119,1098,2067,4114,2061,600,339,1184,218,2096,368,652,1031,230,391,313,4224,450,542,1538,334,1076,233,555,2062,774,175,123,1155,658,2120,612,341,2305,777,220,314,2069,1105,424,1068,395,4108,673,4129 ,583,355,1296,2180,1094,4161,287,183,234,1051,125,557,1216,660,616,342,316,2083,1157,241,778,2306,563,2074,1074,345,452,397,2561,4116,403,1112,207,2128,1540,4352,674,558,785,1100,432,1039,357,187,1162,236,664,1312,624,4130,587,780,1080,2085,1122,705,2073,126,242,2070,1063,565,398,2184,346,456,2308,4120,358,405,303 ,569,2312,1544,4132,244,1158,1097,595,1283,189,4103,566,676,1169,1054,1108,361,2086,706,589,2562,1344,215 ,786,647,348,2144,2115,419,406,464,680,4225,801,2089,4162,1069,362,1164,590,409,1286,4608,570,1121,788,1552,2192,1106,4107,2076,597,1075,572,1186,219,311,2117,708,598,2090,1289,601,651,421,792,4136,802,2564,611 ,1047,602,1172,410,231,2097,4164,688,653,1128,248,1070,2122,4226,369,2320,190,364,1568,654,2208,1095,659,1161,335,480,4115,315,4109,221,3074,370,1285,613,2568,1408,4144,422,425,2336,451,1077,614,543,1298,235,412,2576,343,372,2240,1185,775,317,2592,4110,2118,1539,222,1099,426,4168,2092,453,4353,237,1124,559,1170,2179,1292,4117,833,804,712,1082,834,661,1053,808,779,2129,1217,617,604,2098,1541,433,4228,720,2121,816,1101 ,2063,1176,836,2368,347,897,2181,1136,4131,243,1297,2100,662,4354,2071,1600,4122,454,318,675,1110,618,2182,1081,4609,898,781,1314,1220,376,428,1546,665,4176,736,567,1107,2432,1192,1078,840,2124,2185,625,238,2130,1159,359,457,2104,399,787,2075,2145,4133,591,678,434,4121,677,2087,1290,4118,1542,349,1300,1102,245,4232,1188,458,4356,666,1113,620,1553,1163,2307,1313,4360,363,2132,127,1067,191,2186,1125,782,407,2193,436,626,2309,2077,1218,571,465,681,2091,246,4134,707,2146,4610,1346,350,1084,599,668,2563,1548,4192,4163,790,1165,1320,460,1123,2136,1200,4137,249,2188,682,1664,573,1171,411,803,2078,1116,789,2194,1304,709,365,4240,440,628,4124,689,3076,2119,374,1224,423,2310,1556,4165,466,793,2313,4138,1130,250,371,1174,481,574,1348,2209,4612,413,2624,1109,603,366,2093,1545,4145,2148,1287,1055,468,1570,655,900,4170,2688,805,4368,615,3073,1166,684,1409,710,2099,1187,4256,429,794,2196,25

2,1114,373,605,1232,848,690,2094,5122,2123,713,63
2,2314,1
316,482,4616,806,2321,4384,1132,2565,1083,427,21
52,1177,904,4624,2210,1569,4288,414,1291,2101,22
3,1126,4
640,2241,1554,4166,663,3080,692,835,1328,619,472,
2200,1137,4140,455,796,2125,1189,1601,809,714,22
12,1248,
721,4227,837,2816,716,1086,2316,1302,1352,864,23
22,2566,4177,810,2102,1173,4146,606,1194,2131,91
2,4169,2
105,2569,1103,4111,722,696,377,4416,1424,435,216
0,1293,4229,1560,817,1129,1792,319,621,4148,1180,
812,411
9,484,3072,1345,430,1572,2183,1138,2126,1299,423
0,838,2337,2242,667,1219,488,2133,1111,239,378,23
24,2570,
459,622,2106,2216,1410,4480,627,437,2187,380,417
2,4233,2147,1201,4178,1608,818,1178,1294,461,415
2,2134,1
543,4123,496,4193,669,1190,1317,679,1140,1079,21
08,1221,4135,724,2328,841,1305,629,2137,1584,351,
467,233
8,2577,1360,438,2572,2244,1115,737,251,4355,462,2
189,442,4180,441,3088,2149,4234,1666,469,2195,15
49,4241,
247,683,2224,1196,4357,1226,4125,842,1412,1127,7
38,4139,1144,2190,1308,4194,899,2578,1602,670,13
18,783,2
369,1085,4611,849,2079,1555,1193,820,2248,1576,7
28,928,4184,2138,791,4236,367,3104,2593,1376,901,
1233,63
0,2340,2370,1321,4126,685,844,2580,4242,1204,633,
711,1118,253,691,2311,1301,5124,2197,4167,824,21
50,1175,
902,4358,686,2153,1668,4361,1222,2352,1416,1133,
740,6144,1347,850,375,4257,2344,1558,4672,444,30
78,1306,
2211,470,1167,4141,483,2140,1547,4196,415,3081,4
85,2095,905,1202,795,473,2315,1240,4736,634,744,2
433,512
1,2594,1616,852,960,2372,1322,865,4147,693,2256,4
244,1131,2434,1794,1350,797,2198,2201,1225,4142,
4171,22
13,1604,1571,4362,906,1252,2154,715,1141,4369,21
03,2376,1330,4613,807,3136,474,636,4200,1179,694,
254,258
4,1550,4258,1665,717,2625,1071,1315,575,913,4149,
2596,1440,798,4289,811,3082,5128,2161,379,1208,2
202,135
3,2127,1191,4248,697,2317,2156,4173,1564,431,262
6,1142,4260,607,2272,1228,2214,489,4864,2567,260
0,1324,4
364,866,723,2243,486,4370,1573,4614,2318,1181,41
50,1234,3089,908,1793,1561,718,813,4179,2689,136
4,4153,4
76,4617,856,3084,1117,1411,839,1329,2571,1295,23
23,1146,4208,725,2628,2339,698,1472,914,2107,124
9,752,86
8,2217,2608,5120,2162,819,2325,2204,1349,4231,81
4,4174,439,2135,929,4385,4290,3200,2245,1197,418
1,1578,4
90,2164,1139,4372,1680,623,4618,2218,1632,4154,1
336,4264,671,1198,1362,739,1603,4235,1557,2109,1
413,4195 ,916,3090,2579,1303,463,1236,843,2573,26
90,1135,4182,381,2329,2326,1672,1354,497,2574,22
25,1586,930,821,4
156,2341,2436,726,4376,961,3105,2139,1203,4185,1
182,872,2632,2817,1418,4386,4625,492,2246,1250,4
620,1332 ,4292,631,1574,1223,729,4237,2220,1145,5
136,2168,1605,4197,700,2249,1796,443,4243,1307,7
41,2384,1378,427
2,1562,2110,1356,1205,845,2330,6145,1319,920,382,
4238,2191,3077,1585,4626,822,3092,2151,1425,2226
,851,12
29,4417,730,2342,2141,1609,4127,498,3106,880,269
2,4296,1256,742,445,2250,1392,4186,471,635,2640,1
148,515
2,2371,1696,4641,932,2440,1580,687,4388,4418,234
5,1210,4628,1420,2818,1612,1325,1800,903,6146,21
55,1134,
4359,825,4245,2228,1235,1361,4198,500,3328,1577,
2199,846,1670,4201,2257,2332,1195,4400,745,3075,
826,2696 ,732,1264,446,962,2142,2252,1426,4392,16
20,936,2346,5126,2448,1377,475,853,4259,2656,131
0,867,4188,637,31
37,5129,2400,4143,1551,2373,1230,2581,1414,4363,
907,2203,2258,1206,4481,1667,4642,2353,1588,1333
,4420,48
7,6148,1808,2595,695,1441,4304,2348,2157,1087,44
82,746,3096,828,2232,753,4246,1610,4249,854,2582,
1237,42
61,1326,3108,857,2585,1368,1209,504,799,4202,216
3,1355,4151,255,4424,964,3138,5184,2215,1242,909,
1673,22
73,1559,2374,1309,4632,719,2354,2820,4673,1143,4
77,2205,1617,4644,915,2704,2377,1448,5130,2158,4
209,2165 ,2260,1380,4250,638,4175,748,2219,944,43
65,1728,4204,3086,2824,1331,4674,1227,3112,869,6
152,1592,4320,14
28,491,699,4262,2378,1253,4615,1351,4648,754,320
1,1183,1565,858,1618,4291,2274,1417,2597,1476,43
66,478,3
091,2586,5137,2435,968,1260,383,2356,2264,1212,4
737,910,2464,2319,5132,2327,1801,815,2206,2385,1
579,4619 ,976,4371,2598,2720,870,4676,4387,3140,2
166,1684,4155,1633,917,2380,2627,1337,4265,1241,
4656,4210,2588,1
606,4373,1824,3120,4252,727,1150,1442,493,1357,4
183,2437,1251,5248,2221,1676,4293,873,3085,2169,
1384,701 ,4212,1566,931,2601,2247,1323,4266,1798,
2832,2227,1365,1473,756,2276,6160,2386,1334,860,
499,4157,2360,35
84,5138,2752,4627,731,3202,2438,1648,2222,4621,1
238,4738,823,2602,2629,1575,4377,4374,3094,922,2
441,1199 ,4622,1674,4273,874,2331,1432,4389,1421,918,4484,2170,1636,5153,2496,1254,4187,502,2401,
1795,933,4680,13
66,4865,2609,1338,4294,1682,3144,2251,1587,1211,
1488,743,2111,6176,2388,1358,4268,760,4216,2442,
3097,124
4,1581,4297,881,3329,2575,1147,2630,494,1379,443
2,2604,2229,2343,1272,4158,702,3107,921,2333,437
8,1624,5
01,876,2280,2172,1415,4239,5125,847,2253,1856,51
40,2230,1444,4199,992,4274,2691,1697,447,4390,41
89,3204,
5154,2610,1607,4740,1436,2334,1369,2633,1257,429
8,1704,733,6147,2347,1797,4688,1669,4419,2402,13
40,1231,
4488,827,3093,6149,1590,2259,934,1634,4393,2449,
3152,2233,1474,4866,882,3109,937,2444,2392,963,1
419,4203 ,747,2634,2693,1265,4276,1119,3330,505,2
641,5376,2583,1381,855,924,4247,2288,1810,4305,7
34,4380,829,3098,
5123,2254,1563,4744,1213,2143,1611,2375,1363,419
0,4300,2612,2848,1430,4394,1258,4496,2450,1688,1
386,470
4,965,6208,2404,1614,5185,2355,1730,4448,2349,24
65,1239,4421,938,4629,3208,884,2261,506,4251,132
7,4306,3
114,2616,1589,4401,1804,3168,749,2880,6153,1370,
1640,945,966,4643,2636,3083,1456,4396,1681,4205,
755,3585 ,5144,2234,1266,859,1427,4280,2694,1593,
2452,1388,4630,940,3139,2275,5156,2944,4633,1214
,830,2642,2466,1
809,4211,911,2350,2697,1621,5186,2819,1582,4263,
2408,2587,1832,4321,871,4422,6150,2159,639,4402,
1480,486
8,3100,2379,1698,4253,1335,3216,888,6161,2262,13
72,4752,1245,4425,479,4206,2357,1422,4213,1268,3
110,4308 ,946,3332,1732,1677,750,1802,4267,2236,1
626,5134,2497,1393,4872,969,3121,2265,5160,2456,
508,1613,861,265
7,2644,1446,4426,1857,2599,2698,5249,2277,1339,7
57,2207,6154,2468,1382,4322,970,4645,2358,3141,5
139,2589 ,4634,4483,3336,2821,1700,2658,4404,124
3,4312,919,2705,2381,1594,4512,1433,4367,3113,43
75,2167,1826,4254 ,1504,3146,4433,875,6162,1635,4
646,1259,862,1920,4768,2648,1675,5188,2387,1445,
4214,758,3232,2266,1149,9
48,4428,1359,4675,2416,2700,1816,4636,1596,3079,
2278,5168,2439,1671,1712,977,2361,6272,2498,1385
,4485,92
3,4269,2590,3586,5133,2382,1622,4217,972,3124,22
81,1434,2603,4649,1311,4295,2822,2223,2171,1729,
4880,427
5,3203,761,2706,4324,1396,4434,877,2660,2389,120
7,4408,1475,5632,4800,2825,1449,5250,2268,1812,4
486,952,
4270,2362,1686,495,4650,1262,4677,3153,5142,2472
,1644,4489,1619,3116,2443,1341,6156,1429,4379,18
25,703,2
721,6177,2631,1371,4218,1638,4544,2403,3344,1567
,1736,4449,935,3142,6209,2335,1685,2231,978,1625,
4657,22
82,3099,2173,5192,2605,4299,883,3264,762,2708,26
64,4159,1246,4436,503,2390,2364,1458,4490,5145,3
205,925,
2289,1394,5377,2826,1269,4623,878,4678,2611,1478
,4652,735,4277,4391,3122,5155,2393,1799,4381,167
8,2500,1
860,2445,1443,4328,1637,4220,6164,2451,1481,4301
,1373,3160,4278,2255,1699,1255,4739,993,3588,640
0,2722,1
591,5252,2606,1828,4658,2833,3148,2480,1452,4382
,885,4681,3087,939,2405,2235,994,1400,4395,3210,2
284,271
2,1744,4450,1656,3360,980,2672,6178,5141,2635,16
89,926,764,4307,2828,3128,1270,4497,5200,4281,94
1,3170,5
157,2753,1628,4492,1367,4440,2174,1805,2290,1457
,4682,4741,3111,2613,5378,2446,1921,4689,1583,46
31,2394,
2504,1387,4336,1642,967,6168,2406,1267,5146,2453
,1484,4302,2351,2617,1450,4191,886,4423,3592,618
0,2292,8
31,4660,1683,4896,3206,3145,2643,1342,4498,1811,
3331,947,2237,6151,2614,1705,1431,4452,507,4403,
2724,321
7,1261,4397,1840,3102,4513,889,3156,5256,2409,16
50,984,1760,4309,2754,1490,5162,2637,1615,4664,7
51,3392,
2263,5216,2834,4928,1702,942,2695,2396,1858,4684
,5131,2467,2454,1423,5633,2512,1460,4282,2728,62
73,2849,
1383,4742,996,4500,6210,3117,5187,2410,4323,1692
,4992,3212,2638,1641,2457,4690,1814,4514,3334,97
1,6656,2
618,1477,4398,1273,4745,3169,4867,2836,1512,4456
,1733,3600,4635,890,3154,6155,1598,1374,509,1806,
4207,26
45,3123,1922,5148,2620,1649,4427,949,3234,2267,5
264,2359,973,1397,4310,2756,2646,1489,4405,1708,
3337,264
9,5158,2699,5380,2469,1627,1000,2840,6184,2850,1
690,4284,892,4545,2659,3095,5169,2650,1274,4313,
4504,322
0,2458,1438,2279,4705,1817,4692,6212,2736,2701,1
390,4647,1464,4746,3176,4325,2296,4255,1868,3118
,4516,95
0,6274,2417,1151,4406,1731,5189,1506,4637,2238,1
827,5384,2412,1597,4869,863,4706,3616,2702,1451,
759,4753 ,1864,4429,3143,5161,2707,1714,4215,170
1,3209,2383,5194,2528,6163,1395,1803,1008,2363,6
157,2269,1623,469
6,1482,4435,2418,3333,5280,2661,1276,4314,510,34
56,6192,2470,1435,2473,4464,1652,4748,2499,3125,
2662,512
7,2591,4326,4487,3346,979,2283,2460,4409,1492,45
46,953,2391,2420,1928,4638,1829,5634,3233,4430,2
823,1389 ,5172,2365,1738,4329,763,4651,6158,1872,4870,974,4271,1453,4219,3587,5251,2270,1643,4754
,1713,3147,2474,
1818,6216,1215,4708,1402,4437,2501,6401,2285,162
9,4873,1520,3172,4316,2607,3218,1830,1691,4410,9
54,3340,
6165,2881,1459,5201,2852,1734,4520,2760,3130,288
2,5164,2709,4491,879,3101,981,2856,2827,4769,150
5,4679,3
265,2665,2652,1706,4451,5392,3589,982,2481,6276,
5190,2768,1924,4383,927,4279,2864,3149,1833,4330
,5147,42
21,4653,3224,5312,2884,1639,4756,1447,4712,2395,
1746,2945,1343,4438,1679,4412,3184,6179,5253,229
1,1820,4
337,1761,3345,4874,2710,6402,1479,4659,1275,995,
3648,6170,2502,1740,5170,2366,1401,4441,2723,315
8,2666,1
888,4548,765,4493,3129,6657,2946,2829,956,1496,4
499,3362,3268,2424,5208,2476,4303,1861,3594,887,
2713,622
4,2784,5636,1437,4770,985,4654,2615,3155,1720,48
81,5196,3240,4528,997,3126,5135,2888,1630,4453,1
813,4283 ,2673,1462,5258,2286,1398,4332,4760,320
7,2407,5408,2505,4720,1645,4683,2447,2835,1848,4
876,1687,5176,618
1,2639,1247,5218,2726,1716,4801,2482,6169,2725,1
936,4222,986,4338,3338,6166,3590,5159,2397,4661,
1483,449
4,3348,3150,2293,1651,6280,4442,1745,4552,3236,9
43,2506,6404,2714,1859,1508,4454,3161,4501,2668,
3601,183
4,4399,1454,3211,4665,891,3361,6408,5640,2411,18
41,998,1595,4340,2175,3115,1278,5254,2239,5193,4
691,766,
3173,2830,5379,2455,4285,1465,4662,2484,2674,170
9,4772,5265,3266,2619,5150,2513,1764,5204,2729,1
646,445
7,2294,6182,2755,1737,4802,511,4685,6658,3394,54
40,2398,1485,4311,4882,3132,2647,1404,2716,4743,
1693,444
4,3596,6240,6211,2838,1866,4515,1952,4502,3213,3
368,4560,2508,4776,1491,3171,4897,988,3248,6185,
2297,165
7,1752,5165,1807,4458,2730,3712,1399,5260,2621,1
844,4686,1001,4505,3219,2459,5382,2851,951,1654,
4666,316
4,5217,2837,1926,4884,1707,3352,2757,5648,2413,6
288,5202,2488,1391,1002,2676,6172,2737,1468,4693
,5171,46
68,2422,3272,5282,2471,1836,4315,4407,3604,6213,
2514,1494,2841,4804,1873,4694,6186,3178,2298,538
5,2419,4
697,1271,4747,3222,4517,2529,2622,4888,1694,4898
,3396,893,6660,2461,1923,4707,1461,5143,3157,469
8,2651,1
748,5268,2414,1715,4506,975,4327,3593,6193,1862,
894,4784,1815,4749,3335,3103,5224,2516,1497,4344
,1653,36
18,2703,5166,2948,6218,1510,1762,4465,2853,6416,
2663,1842,4286,1375,3214,4460,2732,3457,5664,275
8,1703,4
750,1009,3235,6304,2477,1466,5191,2842,1874,4755
,2300,3162,2421,5257,2653,4431,4576,3280,955,289
6,2738,4
411,1739,4317,7170,2761,2680,1486,4466,1930,5381
,3364,4709,2530,6664,5504,2854,1889,4518,1004,45
21,6432,
3180,1658,4547,5173,4710,1821,4639,3131,5394,247
5,1718,4331,1929,4508,3225,2952,1599,6672,1507,4
439,177
6,4468,3617,6336,5281,2462,1405,4871,1735,3339,4
413,2271,3174,6688,1831,1493,1010,3602,6214,2711
,1984,56
35,2740,1455,4318,2883,3376,2667,5195,2520,4522,
957,3185,6188,2503,2844,4549,1865,4333,3237,3649
,2857,52
20,2762,4655,5266,3296,983,2769,6275,2885,5388,1
710,4929,958,4900,2764,3134,1514,4808,5178,3350,
4930,475
7,3400,5149,2912,1876,4904,1768,4875,6225,1721,5
313,2858,1938,4713,1660,4700,3221,6194,5637,2654
,4529,15
00,3242,4816,2960,6217,1403,4912,1892,5197,3151,
6159,2770,1819,5272,2744,1741,4932,2425,6464,347
2,2483,1
516,4443,987,4993,3341,6277,3608,5232,2865,1932,
4339,3177,3840,2367,5393,2669,6196,4758,1463,322
8,1012,2
860,6167,2532,5696,1843,4550,3393,4414,2478,3620
,1749,4771,5206,3186,4714,999,3347,6278,5177,288
6,1838,4
994,1277,4877,2715,3267,1647,5410,2536,5316,4472
,4524,3159,2287,5642,2426,4761,1925,4832,2507,26
70,1498,
4663,1742,5203,3458,6528,5288,2675,1513,5174,248
5,1880,4936,2428,6220,6281,1717,4721,1016,4334,3
249,622
6,3656,5255,2866,1953,4455,4553,3226,3342,2509,1
837,6200,4495,1867,4883,3591,6171,2544,6241,2717
,1631,14
69,4687,3238,3365,4774,2727,3188,4530,1747,3127,
4773,767,3269,6183,2772,5386,1904,5638,1724,4445
,2889,33
53,1524,5396,2677,5198,4341,989,3632,2399,5284,2
515,4554,1406,4762,3408,5209,2486,1754,4716,5649
,3163,27
85,5259,2299,6403,5409,2510,1822,4459,2490,6228,
2489,1835,4223,5163,4287,6282,3714,5221,2517,149
9,4878,4
503,3597,6289,2295,1944,2731,4532,1863,4722,3244
,6405,3274,6173,5314,2890,4667,1890,4561,3460,31
75,4777,
2786,6187,4342,1467,4803,3192,1003,3356,6242,294
7,1522,1763,5442,3650,4446,2718,3366,1695,5180,2
831,185
0,4695,990,4764,3133,6659,5644,2897,1005,1937,48

86,3603,3241,5261,2868,5416,4556,1722,3624,2776,5219,297
6,6232,5296,1845,4345,2839,6284,2415,1495,4778,5760,3424,4669,2949,3281,5267,2678,1655,4507,4899,3369,61
74,2733,1765,5212,2892,1956,4885,6290,3252,2681,5400,2759,4805,4461,3166,4536,2301,2739,4724,1487,4785,3
349,7172,6215,2872,1750,4470,1869,5320,3223,4519,2950,6406,5652,2734,1521,4562,959,4889,3716,6409,3270,1
896,5226,4346,1263,4467,3464,3181,5270,2788,1940,4577,1770,4670,3395,2898,5444,2423,6305,1877,1509,4509,
3606,6720,5205,2492,1711,4699,1756,3354,4462,2518,3215,6189,5641,2531,1846,1011,3595,6244,2463,1960,538
3,2533,5151,4564,2953,3250,2843,5666,2521,4751,4996,3288,6784,2682,2792,4901,1784,4711,7169,3664,2900,52
62,3008,4780,1870,5505,3370,4806,2913,6195,2741,5283,1662,4525,1013,4890,6292,3179,1985,4348,5210,3842,4
469,4701,3398,5328,2845,1753,4944,1927,4786,3273,6190,1528,6219,1849,4809,1882,4728,3652,3619,6410,5412,
2954,4578,1766,3300,4902,2763,3189,6417,1511,1954,5228,3378,6661,2855,1719,5179,2522,1777,4523,2684,624
8,3227,2742,5273,2302,5000,895,3598,6306,3713,5665,2765,1439,4510,3119,3363,2623,5387,2961,6197,4319,522
2,3488,1006,2846,6337,2859,5650,1878,4759,7176,4788,2427,3256,1891,4931,5424,3401,4715,4568,3239,6296,52
33,2745,1939,4551,1661,4892,6221,3612,1502,5285,2479,5697,4905,1986,4810,3190,6308,5344,2655,4817,1852,4
933,3276,2537,6912,1934,4812,1723,5182,3372,6412,5398,2914,1772,5448,2771,1515,4960,2534,6418,3621,6662,
1897,1014,4906,3229,6198,3282,5269,2956,1470,4702,3841,3609,2766,5290,2861,6227,5008,1743,3412,6201,252
4,6665,2904,5199,1931,4818,3165,3459,4792,2887,3377,4473,5520,3343,4531,1017,3194,6256,2773,5389,1968,56
56,1881,4913,2746,3520,1894,5225,2962,5888,4415,4717,3297,2800,5276,2916,4908,1769,4580,7168,5441,2867,1
517,4526,1778,5668,3397,6279,5234,2862,6222,5395,2487,1941,4934,2977,6433,6338,1823,4763,5315,4584,3245,
6229,3626,5207,2538,1659,4335,4474,3187,6420,3728,2671,1992,6666,4555,1875,4718,3680,6202,3384,6312,550
6,2719,1755,4723,3246,3410,4533,2787,3651,6283,4476,1501,3605,1018,3461,6243,2964,5297,1900,5704,3351,49
14,2511,3284,1725,5274,2891,5390,4557,991,3183,6230,5639,2429,4592,1933,4765,3720,3402,5286,2545,5413,47
75,5236,3634,2978,5175,2869,6204,5317,1839,4820,2774,6424,3009,1525,4937,5401,3251,4725,6233,3230,5680,2
920,1955,4447,4563,3466,6434,6673,1988,5456,2540,1884,4534,3298,6668,3380,6340,5211,2679,4833,4347,3622,
3271,4558,2777,6285,4538,1726,4537,3193,7184,3653,6245,2748,1948,1780,5762,3844,4565,2491,6291,3355,564
5,2789,1518,4343,1020,4779,3426,6320,3610,5292,5322,1767,4938,3404,3253,5508,2893,5223,4834,1905,3367,29
68,5240,2430,6286,5404,1851,4995,3633,6674,5698,2870,1893,4766,5414,3473,4879,2899,3277,6465,5181,2778,1
945,4945,3657,6175,2546,1757,5651,2928,5289,4916,6344,3304,2790,5672,2493,4824,5024,3440,6234,2519,2683,
4887,1530,4463,3196,7200,3744,6689,5472,2980,4997,1958,5329,3628,4726,2735,6436,6466,5417,1471,4781,100
7,4940,3258,6676,3468,2000,5300,3660,4729,4807,3373,3848,5214,2951,1847,4349,1898,4787,3182,6407,5397,28
73,6293,1523,1942,4920,3283,3409,6246,5271,2548,4998,1961,3625,4782,2894,3718,6249,5764,1871,5318,3243,6
448,2793,1771,5512,2874,5229,4836,2780,3312,2494,5443,3010,4946,4471,3474,6440,3668,5654,2984,1529,4540,
7174,3425,2523,5402,2901,6307,4566,5263,3358,4579,2915,6236,2685,5643,1912,4511,7177,4581,6191,3599,175
8,5001,5298,3278,4891,4569,3462,6411,5336,2955,1989,4730,1946,4840,3254,6529,3715,1526,6690,5712,4948,19
06,5056,3636,3381,6468,5418,2535,4961,1883,4789,3856,2743,3489,6352,1773,1957,5227,3135,6530,5890,2794,1
853,5446,2876,1976,4893,2801,6294,3658,6297,5321,2902,1015,3285,6309,3374,5700,2905,5667,5002,3416,3257,
2552,5348,2847,6250,4811,5237,3403,6199,2303,6472,3012,5426,1751,4903,7232,3290,4570,2957,3721,4732,527
5,3607,4790,4350,3357,6680,2767,5646,1993,5761,1503,4813,6721,3191,1962,5167,2525,5411,4671,5009,3665,66
92,5536,2963,4894,1781,4907,3496,7178,6257,1885,4475,1908,5304,3428,6298,5449,2686,6223,5287,2796,2016,4
793,2992,6413,3776,6252,1854,5660,4527,3379,6722,3275,5238,2917,1532,4703,3640,6368,3476,2539,5324,2747, 6310,4585,1972,3301,6663,3399,6696,5420,2802,1774,4962,3231,3613,4819,2906,3666,6339,4582,5669,3465,1019,3524,6414,2526,5277,1895,5330,7185,5004,3016,3308,1987,5889,2431,5657,4814,4909,3260,6785,5460,2958,4572,1969,4952,7180,3849,5213,2863,5507,4935,1782,5425,3627,6667,5391,3024,6419,5242,1279,4821,2918,6724,6435,1943,4794,5568,3732,5010,6203,3681,5345,2965,1899,4848,4964,3385,6313,3289,6704,1994,6258,1663,4915,3654,6421,3872,6300,5445,2775,4910,3198,3490,4535,2541,3405,6231,5025,1964,3299,7296,3724,6341,2921,5293,1785,5674,3432,4586,2749,6260,3614,5235,2979,5776,4719,1021,3371,6314,3846,5728,5432,1935,4767,3413,3521,5294,2804,5458,4835,5699,3382,2908,5653,2547,6205,5509,1886,5012,7186,6675,5399,2779,2001,4559,5332,3696,4939,6669,3286,6786,5231,2871,1407,4477,3623,6425,6422,1779,5768,2970,5450,4593,3247,6670,3722,6321,5682,2922,5026,4917,3480,6437,3469,2966,6532,4822,1990,5057,3684,7201,3302,6235,5299,2550,1970,5278,3843,4968,2981,6728,3414,6913,5514,1879,1022,4588,3386,6342,3730,5346,5428,3635,4727,3259,3536,5670,2791,5319,4825,1902,3406,6316,5241,2808,6264,5701,1947,4796,3292,3629,6345,5892,2929,4539,5403,3195,4837,2542,3427,6480,5474,1759,5658,3320,6206,2750,1907,5452,2969,5301,4941,6426,3672,2549,5415,2924,5016,4478,3463,6287,7173,5681,2895,1527,4918,3904,7188,3492,6247,5521,3040,6322,4947,5325,3745,4826,2495,6438,6237,5705,1996,4594,7202,4976,3655,6788,3484,1786,5352,3417,4838,4541,3305,6346,3752,5488,2781,1959,4567,2002,4731,3845,6736,3717,5244,6467,5792,1913,5028,3388,3279,6536,5676,2875,4783,1949,3638,2982,3682,6441,5306,2017,5516,3522,6914,5708,2930,1534,5421,2985,5896,4999,3011,3467,6251,5230,2795,4921,3313,6324,3167,5331,2553,5457,4596,7424,3429,2903,5673,2972,6295,4942,5766,3858,6353,2782,6428,2877,5291,1788,4841,7171,3611,4922,6792,3261,4828,5360,3659,4542,5058,3411,6238,6348,5522,1910,5716,1965,5032,3478,6442,3306,2004,6544,5473,4571,4949,3736,3434,6752,5406,3013,4963,1901,4733,3662,7233,3778,6496,1966,1775,5647,3287,6469,5326,2986,6677,5510,2932,2008,5003,2554,6299,3375,6354,5302,5763,3637,6449,3852,5684,2797,5429,4583,3418,3688,2993,5904,3014,6691,4791,5537,3504,6444,3729,6253,5183,2803,1531,4842,7192,3314,4924,2907,3475,6328,4849,5706,3641,4950,3436,6678,2988,5333,1971,5422,7204,4953,6681,3262,1950,5464,2878,5305,4600,4895,3857,6259,5451,2959,4351,1909,5060,3669,7234,3630,6311,5338,5005,1991,5769,3880,6369,5655,2919,6470,5405,2018,4815,2687,6450,3528,6916,1727,5239,3746,4573,6301,3383,5713,2936,1916,5011,3420,6800,3293,6473,5544,2527,6254,1855,3470,6261,3316,6356,5476,2994,4734,3780,3725,4844,2798,3850,6315,5040,5824,3674,7182,3441,6920,3017,5427,1974,5323,7208,4965,2556,3661,5688,2909,5524,4587,4795,3494,6474,3905,5349,5447,1995,4850,7297,3387,5279,2805,5661,4954,5714,3430,6370,5513,3018,6693,5572,2020,4574,7187,6682,6531,1977,5064,5356,3748,4479,6452,3291,6360,5308,2967,1787,5006,3642,6560,3481,6415,1914,6423,5897,4911,3874,6302,3552,6481,5675,2923,5072,3683,6694,3307,2910,3968,6816,4966,2005,3723,7236,3493,6262,5780,2806,1887,5729,3197,5013,2996,6476,3407,6723,5433,5337,1023,3864,6684,3644,5702,5920,7216,4823,3719,3760,5246,3025,5538,4589,5453,3433,6533,5347,2971,6317,5772,1963,4969,7181,3670,6265,5480,3020,4797,5662,3482,5027,6697,3359,6343,5419,1998,5894,3777,6928,6323,1783,5461,2809,5569,4852,6372,3444,6482,5430,2925,4956,4595,3255,6456,3523,7680,6848,2024,4827,3497,7298,3860,6534,5744,3000,6318,5334,3734,4919,2543,6698,3310,6725,5671,1980,7190,5018,3692,6537,3667,5295,5770,3389,4970,3477,6427,3873,5528,2751,5517,5014,1903,3419,6266,3686,5732,6592,5350,1973,4598,3615,3784,6497,5891,2983,5029,5462,3733,3026,3673,6705,5434,2003,5778,7240,6347,5683,2931,1789,5307,2810,5584,4839,6207,3294,6484,5454,2551,4856,3506,6538,7193,5340,2973,5677,4977,3442,7425,3317,6671,5243,2926,6726,4590,5475,3526,6700,2783,6325,6439,5368,1997,4798,7203,3847,5017,6429,3726,5720,3908,4597,4972,3491,6376,3685,6268,5511,2032,1978,4943,3529,6349,3421,5952,6326,5540,5088,3747,3303,6787,5793,3041,4543,1917,3639,7300,3876,6706,5703,2010,5532,3500,6430,5465,2933,6729,5353,298

7,5800,4 829,3042,3448,6443,5893,5765,3792,6498,3704,5436,3028,5327,4923,7189,3737,2974,5686,2812,6355,5030,5730, 3318,6545,7248,6329,5570,2989,1519,4978,7205,3676,5033,6540,3415,6488,5059,5515,3853,4843,3505,6730,678 9,5361,2019,5215,7426,4601,3969,6737,3631,2006,6679,5477,4951,5020,3435,6384,3690,5906,3015,4830,1951,49 25,3315,7194,3532,6350,5659,1911,5309,3498,6239,5707,2934,6471,5459,2021,2879,6708,3731,6944,5526,5354,3 390,6546,3859,5784,2995,5482,5061,3753,3479,6500,5710,2555,6451,5826,3309,6445,3888,6561,5335,2937,5034, 7304,3698,4980,3032,3808,6357,4602,5423,3538,7210,3663,6712,2799,5685,2009,5900,7264,4845,6976,3750,546 6,2990,5736,5041,5062,3906,6732,7179,5552,5777,1790,4851,3471,7681,3508,6330,5362,4955,5523,3431,6790,56 89,3044,6548,5484,2026,5036,7235,6371,3740,7040,1975,5310,3689,4926,6738,3862,6562,5905,3019,2012,5007,3 525,6446,3321,6793,5717,6915,5678,3560,6504,3781,6683,5928,2938,4967,3646,3422,2557,3854,6255,4735,5576, 3970,7196,3697,6475,5794,2997,1967,5431,7312,4984,3021,3445,6358,5468,5341,4575,3537,6453,3756,5518,536 4,7206,5042,7428,3675,5828,3048,5773,4846,5898,3738,6332,5722,2940,6593,5489,1915,5065,7217,3322,6361,65 52,4604,5709,3486,4957,6753,3865,6740,5542,2025,5953,3438,6695,3512,6794,2022,6373,5435,4853,6303,3916,6 564,5478,2998,5066,3199,6454,3779,7237,3554,6685,1981,3875,7432,3645,6917,5796,2911,6754,5339,3499,5015, 2807,6801,3912,6477,5690,5529,7209,3762,6263,3749,5922,5600,7242,4971,3443,3851,5731,3056,5355,4958,601 6,3671,6744,3530,5771,6483,5541,1918,4854,7328,3324,6362,5245,2558,5044,5455,3483,6512,3700,6796,5912,20 33,5692,7175,6374,6535,1999,5767,3027,5808,5073,6457,3540,6594,5481,3001,5019,3976,6686,3877,7682,6478,5 718,5068,3437,7220,3786,6377,5530,2811,6699,5407,3920,6918,3022,6319,3501,6267,5825,2028,7299,3691,4857, 6802,3761,5492,3866,4973,3263,6756,3450,6485,5303,5571,1533,3677,6921,3568,5545,6364,5908,5048,3878,373 9,6458,5782,3002,4591,5358,3507,7249,3782,6568,5740,2011,5715,7212,6539,5437,2927,5525,3029,5921,4799,68 17,3553,6727,5467,5734,3754,6499,7440,5663,3030,5832,5031,7238,3972,6431,5781,2975,6327,5074,5721,3881,6 378,7195,6269,6701,1982,4979,7360,3687,4858,6804,3495,6760,5342,3794,4599,3391,6486,3727,6460,5554,2034, 7301,5021,3868,6385,3809,5490,6922,5365,4974,3527,6707,3323,5574,3043,4831,1979,3788,7218,3449,6489,589 5,2023,5774,3936,6596,5956,2813,6541,5539,5733,3004,3544,6547,5577,5469,7256,6351,3909,5795,2935,5351,50 89,7684,3485,6818,5687,3033,6702,5924,3768,6929,7244,6576,5548,3045,4981,7183,3678,5035,6501,3861,6331,5 090,5496,3510,7306,3446,6380,6808,5840,2013,5752,7456,5076,6768,3693,6731,5785,5022,4860,3896,6924,3735, 7224,5366,2036,5037,3295,7266,3764,6849,5724,5463,3984,6270,5901,3034,6386,5553,2007,7207,6709,3531,654 2,6017,5679,3699,6490,3793,6600,5483,2991,5738,5063,3907,3556,6502,5363,6549,5580,3882,6447,3502,6713,55 46,2939,4982,7688,3889,3046,3643,6388,4927,5779,3326,7302,7241,6739,5438,2814,2030,5907,7427,5043,6333,3 513,6710,5801,5527,4603,3757,6820,7313,5357,5936,7198,4985,3812,7252,3694,6505,5746,5080,5856,3785,6850, 5586,2559,6733,5711,2014,4847,7488,3533,6359,6930,5798,3452,5038,6791,3741,6492,5954,2040,3914,6563,400 0,6550,5519,6608,5556,6824,3539,6945,5479,3036,5092,3705,3800,7213,3855,6506,5788,3447,7308,3892,6734,57 37,3049,6553,5910,7430,5067,2999,3702,6714,5573,5369,7265,3974,6932,3755,5608,5829,7696,4986,7250,3439,5 694,3050,5470,4605,5902,3516,6741,7219,6018,6716,5745,1535,5045,7330,3884,6363,6455,5069,5493,3542,6852, 3921,6742,5585,2027,5804,7433,6745,3319,6795,2029,6565,5723,5096,6936,3742,6946,5786,2941,4988,3971,675 5,3509,7191,6746,5370,3796,7316,3763,6554,5534,3023,6375,5913,3910,2942,6832,3863,6797,5486,5560,7272,35 45,6392,3701,5964,7214,5046,3558,3810,6513,5247,5827,5602,3890,6334,3423,5923,6508,5693,4959,7712,3751,6 798,5547,3057,4855,5960,3514,7239,3922,6803,5810,2035,5797,7305,6479,6624,5491,3003,5899,5104,6459,3787, 6365,5719,5578,3534,6514,3978,7429,6757,5372,4606,7552,3937,6566,5531,3052,6569,5748,3706,6595,7221,675 8,3869,6687,2037,7442,3766,5075,6379,3977,6556,5

588,3647,5049,3555,6487,3824,6516,6024,5925,7329,3453,69 19,3783,5485,6461,5834,4859,3879,3541,5968,3058,5070,5549,4032,7683,3503,6366,5739,1791,5809,7243,6570,5 914,3005,5311,5498,6597,3913,6381,5725,5616,7268,6703,7314,5926,3031,5787,5050,7436,3758,6977,5555,3006, 6948,5830,3562,6856,7226,6978,6805,4975,7197,3924,5077,6952,3816,6923,5601,3769,7361,3986,6761,3708,674 8,5802,2038,7685,5078,6577,3548,6864,6020,5023,3451,6960,3940,7245,5929,2041,3867,7320,3789,6980,5735,55 43,3564,6491,5842,3035,7041,5439,5775,7280,3980,6387,5916,5857,7441,6806,3511,5575,3060,5371,5091,7744,3 891,6598,5836,6462,5497,3797,6819,7254,6762,5984,3047,4861,7225,3886,7042,3325,6925,5052,5592,3695,7458, 7364,6520,6572,1919,5957,7690,4983,6809,3973,6880,5533,5081,3546,6711,3790,7251,5816,7336,5093,3561,722 2,3928,6984,5726,5909,3765,6769,5558,3064,6382,5494,2042,7303,4001,6503,6601,5741,3885,6543,3915,6931,59 44,5783,3679,3517,6735,5343,6822,5812,6578,3795,6821,6032,2815,5082,7434,3952,7686,3772,6493,5579,3572,7 444,7246,6389,5747,3037,5841,7332,5039,6602,3454,6810,5955,5604,7257,3802,6764,7697,5930,5550,7307,4987, 7457,3870,6507,5937,5094,5691,3883,6271,7211,5374,6335,2039,4862,7269,3547,6926,6551,5561,3992,6580,391 1,6770,5805,2044,7362,6715,3938,6609,5860,6825,5742,6390,3515,6851,5833,3051,4607,3570,3811,7490,6494,55 81,3743,7228,3898,6743,5500,3038,6812,5789,7692,3053,3985,6934,5962,6048,7309,7464,6604,3770,5587,7267,5 084,7344,3893,6393,5753,5848,5903,3543,6826,7808,5495,6717,5940,5097,7315,3703,6555,6947,5047,5750,3813, 7260,4004,6933,6022,2043,5803,7448,6853,6509,6584,5487,5098,6772,3535,6833,5564,3798,6518,3917,7368,656 7,5932,7700,3569,6610,5590,3007,6937,5969,3944,7274,6394,3311,6515,5367,7318,3988,6625,3818,6718,5790,74 92,4989,3925,3557,6557,6019,5557,7253,3759,6747,3804,5844,6510,5811,5071,7689,3894,5958,3059,4990,5911,4 008,7431,7199,6612,5593,2031,5749,7714,6799,7044,5606,5858,6949,3832,6759,5938,5471,7310,6828,3918,7553, 6854,5799,5105,7331,3710,6573,5562,3061,6938,5970,4033,6396,7258,6517,6749,7376,3801,5051,6992,3 975,683 4,5835,3576,3897,6857,3930,6776,5582,6026,7460,6626,3814,6950,5985,5100,3559,4002,7276,5754,5917,3767,72 27,3825,6571,5814,6025,7321,7048,5695,2943,5603,5872,7713,3487,6558,5501,5831,7435,6367,7270,5927,3054,5 589,5106,7698,3926,6807,6080,6836,5551,3939,6979,7472,6763,6616,5053,7281,3987,6599,3709,6940,5961,3550, 7333,7745,6953,4034,6858,1983,7392,5079,6865,3900,6981,5806,5054,3982,6860,3771,7230,5610,7446,3820,749 6,3563,7008,5972,5864,3945,5817,3062,6954,6034,5756,7317,3518,6750,5596,7338,7056,3791,5499,5988,7247,39 79,6866,5915,6840,5837,6521,7568,6579,5612,3065,5083,7437,4016,7704,3929,6961,6028,3942,7273,7936,6463,6 765,5559,7324,5108,6956,3817,6628,5939,7489,3565,6574,3826,7716,5845,7282,5095,7443,3989,6982,5934,5373, 3871,6811,7363,5743,6632,2046,7255,3707,6383,6522,6021,4040,6603,3923,6766,5594,5838,7554,3803,6771,560 9,6581,5976,6524,3549,5813,3066,5112,7345,3948,7752,6962,6049,3773,7322,7438,6605,5933,3039,5963,7687,66 40,3981,6813,5727,5565,7334,7461,6823,7284,5843,7223,4863,7365,3887,6868,6000,5820,3573,6985,7449,5620,6 773,5085,7728,4003,6495,6611,5502,4036,7504,3932,6582,5850,2047,7259,6881,6395,6606,5918,6586,3774,6585, 5931,3996,3828,7810,6613,5595,7693,3566,6391,6040,3068,6827,5959,7340,7370,3815,6986,5986,7556,7271,688 2,3953,5563,7288,5099,7452,3899,7043,5618,5859,7746,3941,6814,7462,5791,6927,5946,5086,7229,3993,6993,51 01,6033,3805,7699,7337,6964,2015,5818,7720,6872,7072,5941,6935,3578,6511,5591,7520,7045,4006,7377,6774,5 751,7465,3519,6829,5861,3055,6988,6052,4048,7348,6777,6855,7262,3895,6397,3946,6835,5583,7445,3571,3990, 6968,5846,5965,7319,7046,4009,6830,5617,5055,7812,3919,7366,5992,5359,3819,7560,7277,6884,6036,5866,749 1,6994,6519,5973,5605,7702,3577,6588,5807,5852,7450,6614,7311,6627,5942,5107,7691,3960,6559,6056,6629,38 06,7049,7346,6939,6617,7384,4037,6778,3994,6888,5880,3574,7760,6996,3954,7104,5966,7466,7009,3931,6837,5 758,5109,3821,4005,7275,6081,7938,3901,7494,4024,6941,5849,6023,7369,5624,3063,5945,5978,7748,7715,7050, 5862,7396,6859,7285,5607,6050,7474,3799,6951,5815,6618,5873,6780,7323,6838,6398,4991,7694,4041,7809,3551,6861,5535,4010,7215,7459,6719,7057,7584,5102,6942,3829,6955,5974,3933,6523,3956,7352,5987,7497,7335,4064,6841,6035,5757,3902,7708,5598,6575,6082,7286,3580,6751,5948,7372,6633,4020,6030,5819,7468,3822,7010,5868,6867,5611,6630,7717,5993,3067,5110,7325,3943,7378,7052,5566,4035,7937,7705,6862,6957,5839,7508,6620,4017,7000,6027,7261,7555,6983,3830,7473,7439,5113,7290,3327,6869,6064,5977,3991,6842,7616,5990,7058,7393,3947,6896,7012,5865,4042,3711,6963,5613,5874,7493,6958,6583,6037,7073,4012,5919,7341,3833,7722,6634,5755,7283,7824,6767,6088,3069,5971,7776,7480,3983,6815,5851,7342,7506,6883,7747,5597,7701,5114,7557,3934,7060,5996,7447,4049,6607,7380,5821,6987,5087,7279,3455,6525,6029,3827,7816,7498,6641,2045,7730,7074,6965,5935,6870,4038,7105,5621,7347,4018,7326,7016,6051,7562,3927,6084,3070,6636,5980,7394,7476,6775,7718,7367,6873,3950,5822,7289,7749,3995,6844,6044,5876,7940,6587,7451,6885,5614,5116,7522,3807,7706,5863,3955,7500,7349,6989,6001,7463,7064,6526,5947,7729,3575,6966,5989,7569,6995,7373,6874,6041,7753,4044,6642,5853,7024,3834,7400,6886,6589,7536,4007,6615,4050,6779,5626,7292,7840,3961,7076,6054,7724,6831,3997,5567,5103,7354,4065,7564,6096,7756,3582,7469,7944,7047,5943,5994,7278,6969,5619,6038,7379,7505,6644,6057,7721,6990,7814,5967,7339,3836,6889,5867,6970,6876,7408,6590,7106,7570,3958,7764,4013,7080,5625,4052,7521,6619,6997,7454,7011,3949,6781,6008,4014,3823,7695,5854,7374,7558,4056,7051,6085,6042,7350,7811,5622,6002,7732,7477,6631,5979,7952,6839,7585,5869,6053,7231,3579,6890,5949,6972,6072,6897,7754,6998,5111,7381,4019,7470,7001,3998,7512,7353,6648,6943,7499,6399,3957,7108,5847,7386,7053,4039,7817,7703,7453,4066,6863,6089,5599,3775,7287,6058,6621,7761,3964,7059,5877,7592,3903,5981,6004,7524,6782,6892,6112,7088,7872,5950,7475,4022,7371,7013,5628,7736,7572,6635,6843,6068,7397,7495,4043,6898,5870,7327,7709,7002,7762,7561,5115,7620,4068,6622,5991,4025,7112,7404,6083,6527,7356,3835,7054,6065,3962,7945,6959,5878,7723,7120,5375,7014,4053,6039,7828,3935,7777,7061,5995,7481,7385,6090,3071,5759,7750,7968,6871,7294,7586,6637,7501,6060,7395,7820,4011,7017,5881,7528,6845,7710,7075,5117,7467,4046,7942,6031,3831,7509,7617,6900,7478,7004,6643,5982,4072,6875,6097,7792,7382,6967,5503,7719,4028,5875,7066,7343,7818,7018,7576,7565,7062,3951,6086,7780,7398,4021,6646,6066,7939,7077,7510,5975,5118,7482,4051,7826,7731,3837,7355,7632,6887,5998,7502,6904,6043,7388,7725,7025,7291,6638,7523,5855,7416,4045,6846,6003,7065,7768,6645,7020,7559,4080,4026,6991,5623,8000,7588,7136,7841,6591,3965,6092,7751,4058,7580,5882,7513,7401,7848,6877,6055,6098,7941,7813,6009,7484,7375,6971,6045,7734,7078,7778,6113,7618,3567,7026,5630,7081,7107,7563,6891,7409,4067,7263,6649,4054,7525,6999,7068,7954,6878,3999,6973,5884,7707,3959,7357,7755,7507,4069,6006,6061,7574,7402,6100,7832,7530,7109,5997,7758,7874,6062,5871,7383,7082,7028,6104,6650,7471,7733,4057,7948,6893,7514,7784,7089,7110,7600,7825,3838,6899,5627,7410,7003,7571,7737,7532,4074,7084,6067,4023,7358,6046,6974,7953,4060,7055,6005,7765,7726,6087,7976,7015,6114,6783,7624,5823,7842,4015,7479,7032,6012,7516,7389,6623,5951,7566,7412,7090,7876,7821,6894,7946,7770,7537,3963,7113,6070,6652,7757,7005,7590,4073,8001,6091,4070,7483,6901,7526,7114,6116,4029,6073,7844,7387,7063,5883,7738,7577,6010,7970,7648,7019,7779,7403,7006,8064,6101,7819,7589,3966,6902,5983,7293,7092,7503,5119,7960,4081,7740,4047,7815,7856,7121,7529,7067,6059,7766,7116,7578,7455,6094,7873,4076,5879,6905,7540,7021,7351,7619,3581,6120,7593,7956,7096,7830,6639,7406,6076,7788,4059,7763,7485,7573,7969,6847,5999,7515,7782,6069,7711,7880,7079,7829,7122,7769,6099,4030,7027,5885,6906,7390,6647,7602,4082,7069,7538,7413,7022,7622,6879,4027,6093,7943,4071,7822,8004,7587,7781,6128,6074,7625,7517,7843,7399,7137,6013,7735,7972,6106,7596,7029,7083,7138,7544,7888,4061,7800,7124,7833,7070,6908,7414,4084,7085,5615,7772,7511,7949,7601,4055,6115,8065,7727,6102,7531,7786,7111,6047,7411,7628,6007,7594,7030,6117,697

5,7827,7486,4078,7955,7091,7849,7575,6651,7405,7984,7033,7794,7128,7904,7634,7759,4062,6895,6105,7846,7086,8002,4088,5886,7567,7604,7527,7140,6122,7836,6071,7785,7958,7115,6108,7621,7417,7656,7877,7034,7742,7518,6653,7950,8066,7793,3583,7093,6063,7117,7541,7633,4075,7852,4077,7771,7144,7834,7036,6011,7418,7582,7961,6121,7534,7608,6118,8012,7094,7295,7875,7650,6077,7971,7741,7007,7595,6903,8008,7858,4083,7845,7539,7947,7152,7767,7626,6014,7420,6654,7579,7796,6129,4085,6095,7123,7636,7097,8072,7973,7533,7882,6907,8016,7118,7597,6124,7787,3839,7857,7962,7359,7546,5629,7773,7664,7974,7835,7098,7603,7878,6107,7023,7125,7649,7850,4086,7126,8068,7071,7977,4089,6078,7783,7591,7890,7487,7823,6130,7964,7905,7623,7419,7139,6075,7884,7545,6119,8032,6909,7100,7640,3967,8005,7031,7581,7129,7864,7141,7774,7957,7606,7542,4090,6109,7789,7992,7831,6132,7391,7860,8080,7130,6103,7627,7795,7889,7087,8003,7652,7978,7598,7035,7985,7142,7739,7422,4087,6910,6126,7609,7853,4092,7908,7790,7881,6655,6110,7629,7548,7837,6136,8010,8096,7635,7132,7801,7896,7951,7543,7988,7145,7095,7798,8070,4091,7851,7535,7146,7612,5631,7980,7638,8017,6123,7415,6125,7838,7037,8067,7605,7892,7859,7119,8006,7038,7959,7641,4079,7797,7654,7906,7986,7519,7847,7153,7610,8018,6131,7099,7883,7630,8074,8033,7148,7802,7965,6133,7862,8073,7743,7651,7920,7549,7879,7975,7637,7154,8128,7599,5887,7101,8009,4031,7127,7854,7102,7658,8020,7912,7865,8082,7804,6134,7644,7547,8036,6137,7963,7885,7660,7131,8076,7607,7156,7987,7893,7143,7982,7421,7791,4094,6015,8069,7642,7886,7657,8024,7861,7160,6138,8097,7981,8011,7775,7613,7891,6911,8048,7868,7668,7133,7550,7898,4095,7966,7979,6135,7643,8088,8007,6140,8034,7611,7147,7666,7907,7839,7994,7134,7149,8081,4063,7866,7989,7639,7799,7909,8100,6139,7631,7894,8013,7665,7103,8040,7407,8084,7914,8021,7653,7855,7900,7990,7155,8104,6127,7928,8014,7806,7157,8129,7897,8071,7672,7993,8026,7910,7655,8098,7863,7921,7039,7583,7150,8022,8035,8083,7805,7646,8130,6079,7996,8078,7867,7916,7659,8041,7158,7614,7887,8075,7161,8112,8025,8038,7913,7661,7922,8085,7967,6142,7803,8136,8019,7899,7645,7162,8044,7869,7135,8077,4093,7983,7669,8099,8132,8028,6143,7870,8092,7924,7662,7164,7911,8049,7995,8037,8089,7901,6111,7674,8102,7615,7151,8144,7991,8042,7667,8086,8105,8015,7915,7673,8056,7902,8133,8090,7670,8050,8027,7917,8101,7997,8120,7159,7895,8137,7647,8106,7925,8029,8052,8160,7998,7676,8116,7918,7163,8039,8131,8113,7926,7423,8087,8043,8138,7807,8108,7929,7165,8079,8030,8145,7551,7923,6141,8134,8114,8023,7166,8046,8091,7903,8051,7671,8140,7930,8103,8146,8057,8093,8161,7678,7932,8054,8109,8148,8045,8110,7919,8152,7675,8115,8094,8053,8135,8162,7871,8060,7999,8118,8139,8164,8121,7931,8058,8149,8031,7167,8107,8142,7927,8168,8124,8047,8117,8147,7933,8141,8176,8122,8061,8154,7663,8163,8150,8095,8055,8165,8153,7934,8170,8119,8156,8111,8059,8169,8166,8125,8062,8177,8143,8172,7677,8155,8126,8178,8123,8167,8157,8180,8151,8174,8158,8184,7679,8171,8173,8179,8181,7935,8182,8185,8063,8186,8183,8188,8187,8175,8127,8190,8191, 8159,8189]

**Sequence group 5: Z5_8192**

[0,1,2,7,3,8,11,24,4,10,13,28,16,33,35,77,5,12,14,32,19,38,47,81,22,46,42,88,57,96,102,168,6,17,21,40,23,45,51,90,29,55,59,97,72,111,117,188,34,61,75,115,80,124,134,200,87,136,147,227,152,239,260,388,9,18,26,54,30,58,71,105,36,76,62,118,84,128,141,209,44,74,86,135,92,144,151,233,100,154,170,251,186,269,289,434,53,89,98,150,112,161,179,266,122,180,199,281,211,306,324,474,138,207,230,312,236,325,351,508,257,360,381,535,402,563,610,869,15,25,31,73,39,79,82,140,48,85,93,149,101,159,165,263,56,94,103,162,116,178,196,284,127,197,208,299,232,320,345,495,64,109,123,185,129,198,215,314,148,228,237,327,256,358,373,534,163,247,267,364,282,397,405,560,308,421,456,596,484,633,710,871,69,125,143,218,158,235,254,362,169,258,272,387,290,404,433,585,194,285,300,418,326,447,479,646,341,487,516,679,543,723,752,1013,214,315,335,462,365,494,521,698,401,530,561,739,598,759,831,1101,430,572,611,796,628,854,886,11

72,704,908,941,1157,980,1229,1326,1690,20,37,41,91,49,95,1 06,177,50,107,119,189,131,210,219,343,63,120,132,224,145,231,245,344,153,244,261,379,286,400,410,559,67,142 ,155,226,173,248,268,398,183,278,291,413,305,444,467,623,181,301,318,443,340,480,499,680,368,523,544,721,56 9,747,805,1077,78,167,174,275,192,297,316,435,201,323,332,476,352,506,528,718,259,346,367,514,390,540,568,7 42,424,578,617,791,649,851,892,1147,296,383,414,554,442,595,621,834,470,640,661,867,711,922,953,1210,518,7 08,725,942,743,982,930,1253,816,1066,1102,1346,1114,1470,1534,1770,83,190,195,339,249,357,372,522,276,377, 391,549,423,580,615,837,292,419,439,583,459,622,653,875,488,664,697,914,740,949,1010,1269,342,445,465,652, 497,688,731,932,547,732,754,1002,817,977,1086,1358,593,781,844,1069,877,1112,1152,1427,924,1163,1161,1518 ,1258,1560,1614,1954,382,485,525,734,579,757,804,1029,618,835,857,1105,903,1124,1159,1463,654,883,936,114 8,960,1168,1262,1564,1025,1276,1321,1626,1393,1709,1763,2143,719,944,994,1265,1083,1271,1375,1655,1098,1 366,1437,1743,1498,1815,1922,2303,1129,1475,1553,1847,1597,1936,1888,2356,1684,2008,2061,2509,2169,2594, 2711,3024,27,43,52,99,60,121,133,216,66,137,146,223,157,242,246,394,68,156,166,241,175,298,309,429,203,311, 338,471,354,501,526,737,70,172,191,304,205,336,348,492,217,361,374,531,396,564,590,761,229,385,409,575,437, 614,635,822,449,624,667,882,677,912,945,1335,110,204,212,353,225,375,395,553,252,411,425,603,453,643,663,8 42,274,428,464,631,490,675,683,894,513,686,695,952,778,983,1055,1362,293,489,504,693,539,727,736,968,567,7 77,808,1024,861,1078,1106,1442,601,830,878,1111,925,1144,1216,1504,991,1226,1280,1565,1322,1633,1724,212 6,113,221,243,406,271,426,458,648,288,468,493,687,519,702,713,962,322,505,537,716,566,771,799,1019,599,819, 859,1096,895,1131,1191,1449,349,551,589,806,636,846,843,1134,655,884,910,1173,971,1221,1241,1575,701,927, 986,1230,1021,1292,1325,1659,1065,1353,1409,1744,1515,1828,1930,2320,370,608,642,888,682,921,973,1227,76 8,990,1035,1312,1042,1331,1387,1704,783,1038,1064,1373,1140,1406,1484,1812,1204,1507,1548,1854,1612,1969 ,2019,2375,821,1156,1182,1452,1249,1521,1559,1904,1281,1608,1666,2001,1726,2071,2155,253 2,1414,1670,1751 ,2085,1841,2182,2232,2680,1910,2280,2350,2749,2439,2873,2997,3468,130,253,279,469,319,503,533,746,329,542 ,573,774,604,813,874,1193,363,591,647,838,669,918,900,1208,689,937,978,1275,1030,1299,1340,1685,438,657,69 1,915,767,966,996,1319,773,1034,1051,1342,1081,1388,1425,1781,785,1074,1121,1420,1201,1480,1540,1862,123 6,1591,1610,1980,1668,2021,2105,2491,451,766,770,1022,789,1040,1093,1399,827,1142,1179,1465,1222,1529,16 01,1943,985,1197,1252,1545,1286,1627,1674,2013,1395, 1680, 1755,2090, 1846,2171,2223,2675,1047,1290,1372,16 31,1415,1738,1790,2122,1492,1824,1875,2218,1937,2285,2370,2800,1555,1917,1993,2348,2059,2416,2486,2890,2 136,2518,2589,2981,2630,3134,3154,3775,463,792,812,1188,963,1214,1239,1586,1005,1273,1309,1644,1384,1697 ,1775,2110,1058,1336,1411,1713,1459,1798,1880,2203,1533,1932,1869,2257,2014,2363,2438,2822,1205,1429,147 9,1831,1572,1891,1985,2333,1621,1995,2056,2419,2098,2447,2539,2965,1728,2076,2151,2502,2236,2604,2660,30 78,2299,2734,2785,3204,2879,3279,3302,3640,1287,1486,1615,1998,1692,2044,2077,2474,1768,2164,2188,2574,2 265,2609,2754,3149,1786,2251,2339,2728,2432,2802,2815,3295,2523,2897,2946,3355,3056,3484,3563,3985,1950, 2402,2422,2859,2557,2906,2987,3389,2624,3072,3095,3547,3225,3569,3792,4143,2697,3187,3264,3681,3373,372 0,3854,4279,3433,3888,3969,4392,4064,4487,4566,4981,139,114,65,287,104,264,184,520,126,187,206,454,222,35 9,328,594,160,220,240,337,265,416,376,694,307,392,432,562,475,772,638,959,171,250,270,399,310,422,481,613,3 30,507,448,870,548,660,705,1333,355,486,577,676,529,735,826,1136,605,810,769,1001,893,1195,1043,1664,202,2 95,313,461,350,500,557,715,386,630,509,753,592,786,853,1062,420,546,672,823,639,951,807,1100,584,860,981,1 155,917,1397,1228,2006,450,668,607,904,760,873,1014,1181,703,1075,940,1295,999,1248,1589,1468,794,1027,10 89,1439,1135,1313,1360,1708,1184,1510,1404,1920,1567,2235,1813,2663,234,333,371,536,408,571,629,833,446,7 17,597,863,662,901,970,1263,477,637,762,913,696,1053,943,1238,788,1004,1122,1324,1080,1380,1491,1753,515, 745,678,975,856,1032,1132,1351,825,1200,1056,1606,1175,1434,1450,1871,906,1118,1274,1489,1225,1528,1647, 2288,1347,1683,1579,1902,1773,2027,2104,2768,565,776,881,1097,815,1138,1245,1506,931,1302,1177,1736,1364 ,1546,1640,1978,984,1215,1382,1594,1464,1676,1860,2054,1278,1803,1696,2201,1914,2141,2354,2936,1037,1413 ,1500,1819,1310,1747,1886,2400,1558,1966,2038,2222,1769,2513,2305,3648,1613,2004,2089,2477,2148,2368,244
3,3124,1928,2579,2636,2858,2709,3396,2992,4430,283,393,427,632,482,726,665,958,502,685,848,1011,764,1071,
1123,1402,555,797,738,1091,852,1232,1045,1462,920,1143,1260,1520,1186,1702,1630,2271,600,865,814,1334,99
3,1133,1192,1532,902,1219,1289,1834,1370,1584,1678,2063,1023,1400,1317,1734,1502,1653,1845,2134,1447,180
1,1896,2181,1977,2315,2498,2841,645,1085,891,1251,946,1423,1298,1749,1046,1349,1474,1688,1527,1816,1908,
2238,1151,1595,1451,2031,1391,1839,1893,2453,1682,1964,2074,2324,2139,2395,2593,3178,1213,1625,1523,192
3,1722,2012,2186,2555,1827,2255,2042,2471,2096,2744,2649,3094,1562,2162,2365,2695,2283,2610,2918,3067,24
23,2866,2770,3337,3035,3254,3490,4524,729,972,1109,1398,1180,1457,1642,1940,1247,1759,1495,1999,1581,187
9,2146,2547,1068,1543,1618,2091,1742,2317,2036,2507,1877,2208,2268,2715,1962,2895,2641,3781,1339,1660,18
14,2387,1948,2230,2174,2836,1716,2294,2484,2679,2414,2756,2978,3271,2081,2458,2359,2789,2550,3139,2915,3
371,2651,3003,3191,3544,3099,3457,3861,4141,1410,1840,1991,2290,1761,2577,2373,2856,2128,2393,2703,2954,
2480,3030,3213,3622,1903,2614,2527,3053,2732,3263,3113,3590,2880,3162,3415,3518,3332,3967,3819,4319,221
5,2806,2667,3246,2970,3664,3170,3757,2584,3423,3306,3847,3353,3915,4062,5208,2777,3638,3551,4166,3479,40
11,4243,4625,3739,4204,4124,4800,4364,5545,4689,5856,369,455,527,751,587,780,850,1127,626,955,818,1267,89
7,1170,1328,1638,670,862,1017,1199,934,1455,1256,1700,1073,1386,1525,2025,1357,1754,1830,2330,712,1008,9
61,1307,1087,1377,1505,1865,1203,1599,1436,1784,1574,1915,2116,2467,1146,1538,1478,1901,1652,2067,1983,2
406,1740,2094,2206,2988,2244,2673,2592,3244,802,1033,1190,1453,1306,1513,1807,1960,1120,1551,1672,2029,1
583,2170,2047,2530,1285,1711,1756,2312,1620,2113,2263,2701,1935,2340,2159,2623,2451,2775,2910,3456,1445, 1797,1986,2220,1883,2389,2326,2834,2075,2568,2473,2761,2310,2926,3017,3400,1857,2602,2522,2959,2718,316
4,3079,3599,2430,3060,3229,3940,3325,3815,3718,4453,911,1330,1167,1649,1243,1974,1602,2249,1473,1698,187
3,2227,1822,2154,2383,2843,1441,2083,1898,2493,1795,2337,2302,2932,2041,2437,2628,2783,2564,3038,3131,35
58,1570,1953,2132,2399,2198,2689,2538,3185,1968,2506,2811,3086,2616,3007,3300,3670,2250,2763,2687,3147,2
939,3431,3238,3763,2901,3320,3578,3838,3475,3980,4045,4855,1730,2276,2050,2665,2153,2586,2792,3256,2331,
3022,2747,3208,2863,3347,3417,3870,2428,2962,2839,3465,3144,3384,3628,4301,3061,3733,3495,3958,3672,410
7,4226,4603,2524,2851,3171,3552,3014,3605,3751,4071,3317,3910,3656,4187,3844,4261,4381,4762,3248,3766,39
17,4529,4053,4334,4422,5022,3702,4476,4649,4940,4721,5100,5315,6007,1076,1385,1297,1890,1517,1972,1836,2
381,1585,1780,2156,2696,2069,2456,2595,3063,1657,2108,2017,2500,2297,2912,2571,3156,2242,2644,2766,3344,
2849,3233,3505,3931,1809,2319,2213,2670,2409,2739,2782,3262,2120,2826,2976,3510,3107,3446,3394,4006,251
5,2986,3176,3378,3070,3585,3680,4157,2930,3741,3561,4086,3831,4268,4356,4872,1945,2176,2542,2969,2385,28
88,3153,3527,2682,3285,3044,3449,2657,3630,3710,4182,2752,3116,3194,3950,3315,3663,3797,4565,3426,3895,3
743,4255,4029,4339,4508,4971,2871,3223,3536,3803,3339,4092,3899,4397,3645,3853,4159,4444,3974,4755,4581,
5073,3473,4079,4247,4608,4341,4833,4737,5249,4220,4669,4946,5404,4863,5165,5478,6118,2224,2465,2599,313
7,2820,3411,3084,3735,2737,3240,3215,3877,3362,3991,3836,4493,2944,3570,3323,3813,3654,3926,4167,4435,35
24,4102,4238,4588,4052,4677,4822,5242,3046,3440,3758,4020,3608,4262,4133,4659,3685,4175,4323,5002,4469,4
739,4761,5374,3893,4414,4556,4816,4374,5080,4894,5336,4271,4930,5150,5632,5056,5440,5600,6452,3268,3724,
3824,4403,4026,4236,4548,4841,3947,4317,4451,4910,4642,5133,5017,5497,4148,4514,4661,5094,4744,4964,523
1,5716,4771,5299,5171,5565,5345,5687,5787,6660,4350,4683,4849,5224,4925,5257,5424,5638,5039,5418,5330,58
69,5530,5875,5757,6348,5149,5492,5616,5938,5702,5972,6054,6209,5800,6067,6146,6285,6221,6941,6535,6604,108,164,176,273,193,277,317,440,213,302,334,472,378,512,532,787,238,321,347,510,403,545,612,801,431,609,576,839,674,880,916,1198,255,380,415,570,436,606,641,847,483,658,684,885,756,954,987,1272,517,699,779,974,798,1012,1052,1315,836,1060,1107,1412,1137,1456,1526,1905,294,384,460,651,491,681,750,929,538,784,706,989,828 ,1031,1090,1350,586,775,832,1057,868,1099,1126,1428,905,1145,1207,1488,1266,1550,1616,2028,650,840,889,1117,957,1165,1237,1542,1003,1242,1311,1588,1355,1663,1718,2125,1070,1345,1419,1687,1438,1720,1794,2212,1512,1826,1882,2275,1939,2344,2455,2990,356,457,498,763,556,793,809,1088,616,829,872,1113,909,1160,1185,1536,671,876,919,1169,979,1234,1300,1600,1026,1301,1348,1645,1422,1710,1782,2183,714,947,1007,1261,1036,1305,1365,1695,1108,1416,1444,1727,1509,1821,1858,2274,1174,1477,1544,1838,1593,1926,1947,2338,1669,1990,2088,2421,2158,2503,2669,2994,744,1016,1095,1374,1154,1433,1499,1833,1202,1516,1561,1900,1617,1944,2024,2398,1293,1604,1646,1984,1721,2060,2138,2534,1772,2166,2234,2606,2296,2700,2760,3259,1363,1699,1758,2100,1842,2180,2246,2642,1938,2267,2342,2729,2426,2774,2917,3407,2016,2364,2457,2848,2490,2958,3019,3523,2655,3059,3120,3501,3196,3619,3773,4297,407,541,574,864,619,879,933,1231,625,938,992,1277,1044,1354,1379,1777,709,997,1048,1403,1103,1421,1472,1779,1141,1471,1530,1876,1605,1933,1963,2336,733,1094,1149,1408,1217,1482,1549,1927,1255,1578,1622,1971,1662,2052,2111,2482,1246,1651,1705,2049,1771,2145,2190,2608,1849,2252,2301,2698,2358,2746,2865,3366,790,1194,1218,1569,1288,1639,1701,2030,1316,1715,1746,2131,1799,2205,2262,2691,1522,1783,1844,2229,1907,2287,2357,2735,1997,2380,2469,2838,2541,2952,3029,3486,1636,1889,1976,2328,2046,2420,2476,2922,2118,2521,2562,2985,2672,3090,3146,3589,2240,2662,2705,3122,2736,3198,3103,3661,2884,3349,3409,3801,3428,3989,4083,4405,824,1282,1296,1767,1483,1818,1856,2248,1573,1870,1912,2314,1996,2386,2464,2928,1624,1988,2040,2392,2095,2479,2546,3001,2168,2569,2640,3075,2730,3136,3253,3684,1776,2053,2107,2545,2185,2622,2714,3106,2309,2716,2765,3237,2886,3190,3382,3821,2413,2816,2941,3352,3005,3425,3494,3925,3093,3509,3507,4057,3669,4116,4194,4638,1885,2161,2254,2720,2384,2772,2862,3282,2470,2924,2966,3413,3051,3445,3504,3978,2549,3013,3112,3488,3161,3517,3675,4121,3277,3694,3765,4208,3873,4325,4395,4870,2693,3128,3219,3679,3376,3687,3849,4253,3402,3834,3939,4369,4028,4465,4599,5051,3453,3996,4106,4505,4173,4615,4555,5109,4289,4704,4773,5275,4898,5363,5484,5784,466,581,644,896,692,1000,1049,1368,728,1061,1104,1401,1153,1466,1476,1919,741,1150,1189,1461,1223,1641,1675,2011,1327,1681,1765,2119,1806,2193,2259,2724,748,1212,1284,1658,1338,1760,1788,2177,1369,1832,1863,2269,1925,2346,2408,2780,1417,1895,1959,2372,2034,2462,2505,2899,2066,2483,2576,3011,2601,3069,3129,3785,950,1332,1359,1800,1407,1864,1921,2323,1493,1965,2002,2436,2079,2529,2567,2935,1566,2009,2106,2497,2173,2597,2613,3034,2226,2618,2635,3143,2810,3200,3330,3829,1629,2172,2199,2632,2286,2708,2722,3175,2352,2809,2870,3275,2974,3368,3414,3946,2433,2914,3006,3422,3096,3481,3598,4036,3212,3612,3699,4122,3768,4218,4346,4851,965,1390,1467,1952,1556,2003,2093,2540,1611,2112,2178,2620,2241,2648,2678,3166,1714,2204,2281,2686,2351,2798,2854,3267,2427,2891,2968,3398,3036,3455,3556,3957,1789,2321,2405,2868,2511,2943,2938,3462,2552,3016,3065,3525,3181,3604,3637,4137,2647,3098,3206,3620,3270,3716,3771,4258,3346,3812,3897,4371,4051,4480,4607,5070,1852,2450,2526,3021,2612,3088,3184,3614,2794,3211,3291,3754,3304,3780,3865,4315,2819,3296,3343,3846,3471,3891,4008,4460,3580,4042,4101,4513,4192,4658,4717,5129,2893,3499,3541,3963,3653,4061,4114,4578,3700,4186,4267,4698,4349,4783,4883,5297,3906,4273,4380,4799,4498,4915,4970,5451,4585,5024,5102,5520,5198,5643,5756,6168,1041,1494,1582,2115,1706,2197,2273,2743,1733,2293,2367,2804,2441,2878,2999,3560,1837,2411,2536,2929,2583,3083,3043,3587,2625,3114,3193,3692,3283,3732,3793,4291,2035,2554,2627,3077,2791,3173,3222,3762,2803,3289,3322,3795,3374,3867,3922,4419,2824,3361,3439,3914,3575,4003,4091,4523,362

7,4164,4189,4675,4270,4719,4824,5258,2072,2788,2796,327 3,2833,3298,3393,3882,2909,3477,3534,3982,3607,4076,4178,4624,3205,3568,3659,4097,3706,4210,4278,4709,38 75,4284,4386,4805,4503,4901,4960,5446,3314,3714,3843,4216,3908,4363,4432,4846,4019,4474,4539,4955,4617,5 031,5123,5570,4109,4594,4688,5099,4770,5176,5254,5656,4862,5283,5359,5742,5401,5883,5900,6413,2102,2840, 2877,3550,3168,3595,3634,4156,3243,3690,3749,4235,3860,4306,4412,4831,3335,3787,3901,4332,3972,4443,454 5,4939,4081,4610,4531,4999,4711,5115,5196,5591,3582,3928,4001,4484,4131,4560,4679,5086,4203,4691,4767,51 79,4814,5207,5306,5728,4352,4788,4878,5268,4975,5373,5432,5830,5046,5506,5557,5944,5647,6012,6031,6307,3 708,4010,4196,4694,4299,4753,4790,5240,4401,4892,4922,5344,5008,5378,5525,5896,4427,4992,5090,5499,5191, 5572,5584,6024,5288,5663,5713,6077,5812,6181,6245,6568,4632,5163,5182,5630,5327,5671,5746,6104,5394,582 5,5846,6233,5963,6249,6425,6680,5468,5930,5999,6340,6090,6371,6474,6773,6143,6497,6556,6847,6623,6908,69 58,7203,1084,969,724,1609,928,1537,1259,2245,1020,1270,1343,2080,1396,1825,1732,2418,1164,1383,1460,1764 ,1541,1981,1868,2633,1667,1913,2022,2343,2130,2801,2516,3159,1211,1487,1554,1931,1679,1994,2149,2461,173 7,2210,2065,2991,2313,2560,2658,3783,1810,2165,2378,2598,2266,2721,2907,3466,2442,2875,2795,3235,3033,35 65,3305,4264,1320,1634,1693,2099,1793,2191,2334,2684,1899,2496,2216,2764,2412,2825,2957,3341,1989,2307,2 590,2900,2519,3141,2869,3406,2396,2972,3197,3498,3081,3879,3617,4702,2070,2581,2448,3054,2778,2998,3260, 3539,2653,3364,3119,3723,3228,3651,4161,3986,2845,3280,3387,3943,3463,3755,3826,4322,3546,4047,3889,459 7,4126,4973,4462,5434,1432,1752,1855,2279,1957,2362,2495,2921,2058,2690,2425,2979,2566,3048,3179,3676,21 35,2512,2781,3074,2639,3327,3126,3632,2831,3242,3443,3770,3372,3856,4017,4383,2233,2741,2605,3188,2964,3 287,3459,3809,2904,3573,3333,4184,3529,3935,3960,4534,3057,3435,3691,4014,3611,4074,4240,5034,3802,4288, 4145,4575,4409,4727,4821,5539,2349,2808,3010,3399,2883,3469,3644,4040,3104,3737,3531,4361,3833,4098,422 9,4672,3203,3596,3858,4169,3979,4280,4520,4764,3697,4449,4304,4936,4590,4867,5106,5704,3294,3905,4031,44 70,3752,4375,4552,5160,4113,4654,4743,4959,4402,5278,5053,6313,4193,4700,4803,5244,4875,5120,5202,5873,4 605,5349,5407,5628,5481,6109,5751,6873,1598,1918,2007,2501,2152,2706,2573,3158,2196,2617,2948,3257,2786, 3357,3444,3886,2329,2852,2727,3390,2956,3624,3309,3976,3087,3478,3673,4059,3548,4313,4214,5014,2431,298 2,2882,3784,3217,3460,3557,4080,3049,3602,3712,4488,3840,4153,4282,4775,3274,3883,3760,4359,4033,4250,45 02,4860,3954,4447,4568,4913,4671,5064,5264,5611,2533,3380,3027,3658,3133,3919,3730,4377,3312,3806,3994,4 295,4073,4466,4582,4977,3492,4170,3961,4733,3871,4495,4562,5214,4287,4651,4786,5074,4865,5154,5362,5921, 3593,4207,4066,4600,4343,4708,4919,5324,4478,4996,4750,5236,4812,5515,5420,5844,4119,4890,5118,5465,502 8,5379,5683,5820,5183,5635,5541,6062,5794,5989,6186,6934,2712,3182,3419,3880,3538,3970,4232,4620,3650,43 91,4023,4695,4147,4544,4873,5317,3351,4095,4199,4806,4368,5066,4741,5272,4542,4944,5011,5487,4648,5660,5 412,6417,3791,4259,4463,5144,4629,4967,4905,5606,4336,5041,5251,5449,5173,5527,5739,6004,4794,5220,5111, 5560,5319,5887,5681,6088,5422,5762,5933,6230,5850,6159,6479,6677,3898,4496,4685,5036,4393,5347,5127,562 6,4853,5152,5474,5719,5246,5790,5952,6294,4576,5384,5293,5809,5503,5997,5864,6267,5648,5907,6127,6212,60 58,6554,6446,6799,4952,5576,5438,5982,5732,6325,5913,6399,5354,6134,6034,6468,6074,6518,6620,7325,5548,6 304,6235,6694,6176,6588,6748,6995,6386,6722,6667,7099,6830,7491,7033,7633,1850,2086,2260,2758,2403,2814, 2950,3451,2488,3151,2889,3682,3040,3521,3776,4225,2587,2975,3265,3572,3110,3968,3666,4310,3359,3864,406 8,4724,3818,4384,4482,5082,2677,3250,3165,3746,3383,3851,4039,4526,3579,4176,3937,4424,4135,4591,4837,52 30,3485,4088,4000,4573,4249,4779,4678,5166,4366,4810,4942,5747,4984,5443,5361,5980,2860,3288,3554,3964,3 745,4049,4455,4646,3437,4104,4275,4730,4150,4899,4757,5295,3705,4329,4387,5061,4201,4835,5005,5472,4614, 5091,4888,5392,5211,5546,5674,6158,3952,4441,468

0,4957,4550,5146,5076,5603,4787,5338,5238,5532,5059,569 2,5776,6113,4517,5370,5286,5723,5489,5909,5831,6275,5189,5814,5966,6537,6051,6443,6368,6888,3066,3778,35 15,4242,3642,4665,4179,4989,3993,4307,4536,4965,4472,4881,5139,5613,3945,4796,4570,5260,4438,5089,5049,5 699,4749,5195,5398,5554,5334,5797,5880,6240,4128,4636,4857,5159,4933,5460,5304,5927,4656,5271,5580,5838, 5386,5767,6028,6330,4990,5535,5458,5893,5706,6140,5974,6404,5666,6047,6257,6462,6173,6563,6611,7132,435 4,5019,4759,5436,4880,5356,5562,5991,5083,5781,5517,5948,5633,6070,6129,6484,5187,5725,5609,6165,5891,60 99,6297,6786,5815,6380,6191,6548,6332,6656,6737,6982,5289,5621,5914,6236,5774,6280,6395,6628,6044,6514,6 319,6710,6466,6760,6839,7076,5984,6406,6520,6937,6615,6810,6868,7227,6356,6900,7008,7182,7052,7268,7380, 7695,3365,3863,3727,4558,4055,4663,4490,5136,4154,4417,4884,5466,4781,5218,5364,5817,4257,4828,4715,526 6,5043,5677,5341,5902,4982,5415,5537,6068,5619,5970,6199,6530,4457,5068,4950,5441,5168,5510,5553,5996,48 43,5595,5737,6204,5859,6152,6107,6584,5280,5745,5919,6094,5822,6262,6338,6688,5697,6387,6242,6639,6456,6 765,6824,7141,4627,4907,5310,5731,5141,5654,5899,6218,5453,6016,5801,6154,5429,6299,6362,6706,5523,5866, 5935,6543,6041,6324,6429,6956,6136,6502,6389,6756,6601,6813,6923,7196,5640,5960,6224,6434,6064,6644,650 5,6850,6310,6472,6690,6883,6559,7072,6967,7252,6171,6634,6751,6985,6815,7119,7061,7346,6733,7020,7185,74 26,7137,7301,7461,7739,4961,5228,5368,5885,5588,6123,5836,6383,5508,5977,5954,6488,6082,6572,6460,6912,5 710,6250,6049,6441,6317,6526,6695,6877,6216,6652,6745,6971,6614,7025,7112,7342,5803,6148,6400,6595,6282, 6761,6672,7013,6343,6701,6802,7215,6897,7063,7075,7409,6500,6862,6951,7109,6835,7256,7152,7391,6767,717 6,7293,7532,7243,7442,7518,7860,6002,6374,6450,6854,6599,6743,6947,7124,6541,6797,6887,7163,7004,7284,72 24,7471,6683,6927,7015,7265,7066,7193,7336,7571,7081,7371,7304,7501,7396,7557,7603,7929,6820,7029,7128,7 333,7173,7350,7436,7535,7235,7433,7388,7639,7484,7641,7589,7825,7292,7469,7525,7667,7564,7680,7713,7774, 7609,7718,7750,7802,7779,8009,7888,7911,182,262,280,412,303,417,473,634,331,452,496,673,550,722,749,1063, 366,478,511,720,582,765,849,1082,620,845,803,1128,926,1178,1220,1552,389,552,602,795,627,841,887,1139,690, 907,939,1183,1028,1264,1303,1637,730,956,1054,1291,1079,1337,1381,1689,1125,1392,1446,1796,1481,1848,192 9,2353,441,558,659,899,700,935,1018,1235,755,1059,964,1304,1115,1356,1426,1725,820,1050,1119,1389,1162,14 35,1469,1817,1206,1490,1563,1887,1632,1956,2032,2485,898,1130,1187,1458,1268,1514,1596,1949,1323,1603,16 86,2000,1731,2084,2144,2596,1405,1719,1805,2109,1829,2147,2231,2688,1911,2264,2325,2757,2390,2829,2945,3 511,524,656,707,1039,782,1072,1092,1424,855,1116,1166,1454,1209,1508,1535,1941,923,1171,1224,1519,1294,1 592,1671,2015,1352,1673,1723,2062,1811,2133,2214,2656,976,1254,1329,1628,1361,1677,1745,2117,1448,1802,1 835,2157,1909,2258,2300,2755,1524,1874,1951,2278,2005,2376,2397,2823,2092,2446,2551,2913,2629,3002,3177, 3513,1009,1341,1431,1757,1503,1823,1897,2272,1557,1916,1967,2347,2033,2394,2481,2887,1661,2018,2064,244 0,2150,2525,2611,3031,2202,2637,2710,3108,2779,3209,3272,3789,1741,2121,2187,2563,2282,2654,2725,3150,23 88,2748,2827,3239,2919,3286,3434,3941,2472,2850,2947,3363,2989,3483,3543,4063,3163,3586,3647,4038,3725,4 158,4312,4832,588,758,800,1158,858,1176,1240,1590,866,1244,1308,1643,1371,1729,1762,2209,967,1314,1376,1 787,1440,1808,1867,2211,1485,1866,1934,2318,2020,2382,2415,2821,998,1430,1496,1792,1576,1878,1955,2377,1 619,1987,2037,2424,2082,2514,2578,2977,1607,2068,2127,2510,2200,2615,2664,3109,2289,2731,2784,3207,2844, 3258,3381,3903,1067,1547,1577,1975,1654,2055,2123,2487,1691,2142,2175,2603,2237,2683,2742,3201,1924,221 7,2284,2704,2355,2771,2842,3247,2454,2867,2961,3354,3039,3476,3555,4021,2051,2332,2429,2812,2508,2911,29 71,3441,2585,3018,3064,3506,3180,3616,3674,4125,2717,3172,3214,3649,3249,3728,3629,4198,3404,3884,3942,4 340,3966,4525,4619,4934,1110,1648,1665,2195,1881,2256,2298,2726,1979,2311,2360,2799,2452,2874,2955,3448, 2039,2444,2499,2881,2558,2973,3047,3520,2638,3073,3148,3600,3241,3665,3782,4221,2207,2517,2572,3045,2659,3127,3224,3633,2793,3226,3278,3767,3405,3719,3916,4358,2905,3331,3464,3887,3526,3962,4030,4464,3618,4046,4044,4595,4205,4653,4731,5164,2327,2631,2733,3230,2872,3284,3379,3814,2963,3442,3489,3949,3577,3984,4041,4515,3050,3537,3639,4022,3689,4056,4212,4660,3808,4231,4305,4747,4413,4858,4926,5383,3202,3655,3750,4215,3911,4223,4389,4785,3934,4373,4479,4903,4567,4994,5125,5558,3990,4533,4643,5033,4706,5142,5081,5610,4826,5227,5291,5766,5410,5848,5958,6234,666,811,890,1196,948,1318,1378,1748,995,1394,1443,1785,1501,1859,1872,2369,1006,1497,1539,1853,1580,2057,2097,2468,1703,2103,2194,2588,2243,2668,2738,3234,1015,1571,1650,2078,1712,2189,2221,2650,1750,2270,2304,2750,2374,2830,2898,3292,1804,2341,2410,2857,2492,2953,3004,3416,2531,2980,3080,3535,3102,3594,3657,4327,1257,1707,1735,2239,1791,2306,2371,2807,1892,2417,2459,2927,2543,3025,3071,3458,1973,2466,2570,2996,2645,3100,3117,3562,2702,3123,3142,3671,3326,3729,3862,4365,2043,2643,2676,3138,2769,3218,3232,3703,2837,3324,3388,3807,3496,3904,3951,4486,2925,3432,3528,3959,3621,4015,4136,4574,3744,4151,4237,4662,4308,4756,4879,5366,1279,1774,1861,2401,1961,2460,2556,3037,2026,2580,2652,3125,2719,3157,3186,3695,2140,2681,2762,3195,2835,3311,3370,3798,2920,3410,3491,3932,3564,3992,4093,4494,2225,2805,2896,3385,3008,3467,3461,3998,3052,3540,3591,4065,3709,4142,4177,4676,3155,3623,3736,4160,3800,4256,4311,4792,3881,4351,4436,4904,4589,5009,5134,5574,2292,2940,3023,3545,3115,3615,3713,4152,3307,3742,3825,4293,3837,4320,4407,4850,3334,3830,3878,4385,4007,4431,4547,4988,4117,4580,4637,5040,4728,5181,5241,5631,3412,4037,4078,4500,4191,4598,4652,5104,4239,4722,4801,5219,4882,5302,5396,5788,4445,4808,4911,5316,5026,5427,5479,5931,5110,5533,5604,5995,5696,6105,6210,6582,1367,1894,1992,2582,2129,2674,2753,3255,2163,2776,2853,3318,2931,3397,3519,4096,2277,2902,3032,3450,3085,3609,3571,4123,3130,3641,3721,4230,3816,4272,4333,4827,2494,3055,3132,3601,3303,3701,3753,4302,3316,3823,3855,4335,3909,4408,4461,4949,3338,3896,3977,4454,4111,4541,4626,5050,4168,4699,4725,5193,4804,5243,5339,5749,2537,3301,3310,3804,3348,3832,3927,4421,3427,4012,4072,4518,4144,4612,4713,5151,3734,4103,4197,4634,4246,4748,4811,5234,4415,4819,4917,5322,5032,5413,5470,5925,3848,4254,4382,4754,4446,4897,4963,5360,4559,5003,5065,5464,5143,5538,5625,6039,4645,5117,5209,5601,5287,5672,5743,6121,5377,5773,5842,6197,5884,6323,6341,6795,2565,3356,3395,4087,3696,4132,4174,4693,3774,4227,4286,4772,4400,4840,4941,5346,3869,4328,4439,4864,4509,4974,5072,5450,4618,5137,5058,5507,5235,5618,5695,6061,4118,4468,4540,5012,4670,5087,5200,5586,4740,5212,5284,5675,5331,5703,5795,6184,4886,5308,5390,5760,5485,5857,5912,6278,5552,5981,6026,6381,6111,6439,6459,6704,4248,4549,4732,5216,4834,5270,5309,5730,4931,5405,5433,5829,5514,5862,6000,6336,4956,5501,5593,5975,5690,6042,6056,6454,5779,6126,6169,6498,6260,6593,6650,6932,5158,5658,5679,6092,5813,6133,6202,6524,5878,6273,6292,6637,6398,6654,6808,7027,5946,6366,6427,6731,6512,6759,6848,7107,6557,6871,6921,7171,6980,7222,7263,7467,1418,1283,988,2023,1233,1942,1623,2723,1344,1635,1717,2544,1778,2261,2160,2908,1511,1766,1851,2192,1946,2435,2308,3140,2087,2361,2478,2828,2600,3313,3012,3688,1568,1884,1958,2379,2101,2449,2619,2951,2167,2685,2528,3512,2797,3062,3167,4324,2247,2634,2864,3101,2745,3231,3424,4002,2933,3392,3308,3764,3559,4100,3839,4798,1694,2048,2114,2561,2228,2666,2818,3192,2345,2995,2692,3276,2903,3340,3482,3876,2445,2790,3092,3418,3015,3668,3386,3938,2885,3493,3726,4035,3606,4418,4155,5225,2535,3082,2937,3581,3290,3516,3790,4077,3160,3900,3646,4263,3759,4190,4697,4522,3360,3811,3921,4483,3999,4294,4362,4856,4082,4584,4429,5122,4666,5483,4991,5916,1820,2179,2295,2759,2407,2847,2993,3438,2520,3199,2916,3500,3068,3574,3707,4213,2607,3009,3293,3597,3145,3859,3652,4172,3345,3772,3981,4309,3907,4396,4557,4914,2707,3252,3105,3717,3487,3820,3995,4348,3421,4110,3866,4720,4069,4475,4497,5

062,3584,3973,4228,4554,4149,4611,4777,5543,4342,4825,4682,5101,4938,5250,5337,6013,2832,3321,3533,3933,3403,4005,4183,4579,3631,4277,4070,4895,4370,4635,4766,5192,3731,4134,4398,4703,4516,4815,5048,5282,4234,4980,4839,5448,5114,5382,5608,6161,3828,4442,4571,4998,4290,4908,5079,5657,4650,5178,5263,5469,4932,5770,5559,6709,4729,5223,5321,5734,5388,5624,5701,6315,5132,5834,5890,6091,5957,6529,6207,7191,2010,2366,2463,3000,2621,3216,3076,3686,2671,3121,3472,3786,3299,3892,3983,4426,2813,3367,3236,3924,3480,4163,3842,4512,3613,4013,4209,4596,4085,4848,4752,5522,2923,3503,3401,4326,3748,3997,4094,4616,3576,4140,4252,5016,4379,4690,4817,5292,3805,4423,4300,4893,4572,4784,5030,5375,4492,4979,5093,5426,5190,5569,5755,6079,3028,3913,3553,4195,3660,4459,4269,4909,3845,4345,4532,4830,4609,4995,5108,5486,4027,4705,4499,5256,4411,5023,5088,5709,4823,5175,5305,5578,5381,5651,5847,6359,4130,4746,4602,5126,4877,5233,5431,5811,5007,5505,5269,5727,5329,5992,5904,6291,4657,5403,5622,5943,5536,5863,6145,6270,5680,6098,6014,6485,6244,6419,6598,7241,3221,3711,3956,4420,4075,4507,4769,5148,4188,4921,4564,5217,4684,5071,5387,5805,3885,4631,4736,5323,4902,5571,5262,5765,5069,5456,5519,5962,5172,6125,5895,6801,4331,4793,4993,5645,5157,5477,5417,6073,4869,5549,5741,5929,5670,6001,6195,6433,5313,5715,5615,6030,5807,6328,6142,6510,5905,6215,6370,6635,6296,6575,6853,7026,4437,5025,5206,5544,4924,5833,5629,6089,5367,5650,5951,6175,5736,6239,6391,6692,5103,5868,5783,6258,5979,6426,6306,6669,6112,6347,6545,6618,6481,6919,6826,7131,5462,6046,5918,6414,6189,6720,6353,6783,5839,6550,6464,6843,6496,6890,6979,7566,6019,6703,6641,7041,6591,6949,7087,7295,6772,7065,7017,7382,7155,7700,7327,7807,2291,2548,2740,3269,2894,3329,3474,3988,2984,3678,3408,4219,3567,4060,4316,4763,3089,3497,3796,4108,3636,4504,4202,4845,3894,4406,4604,5248,4357,4916,5010,5583,3183,3779,3693,4285,3918,4390,4577,5055,4115,4710,4477,4954,4674,5116,5353,5722,4018,4623,4538,5098,4782,5298,5197,5662,4900,5326,5455,6203,5493,5924,5845,6412,3377,3822,4090,4501,4283,4587,4985,5170,3975,4641,4809,5253,4687,5411,5274,5786,4245,4861,4918,5566,4738,5351,5513,5950,5140,5594,5400,5877,5708,6018,6138,6574,4491,4972,5201,5467,5077,5646,5579,6072,5307,5824,5729,6006,5564,6151,6228,6533,5045,5855,5778,6180,5965,6349,6279,6675,5688,6264,6402,6903,6477,6823,6758,7204,3592,4318,4054,4778,4181,5186,4714,5498,4530,4842,5063,5475,5001,5395,5639,6080,4485,5314,5095,5750,4969,5590,5556,6157,5267,5694,5882,6025,5819,6247,6321,6647,4668,5162,5372,5655,5445,5939,5793,6365,5180,5764,6053,6286,5870,6220,6458,6724,5500,6008,5937,6335,6163,6555,6408,6788,6131,6473,6661,6837,6587,6930,6968,7407,4887,5529,5277,5917,5393,5840,6033,6420,5585,6232,5994,6385,6096,6492,6546,6859,5686,6182,6076,6580,6333,6522,6697,7121,6265,6769,6603,6914,6725,7006,7078,7282,5780,6085,6354,6642,6226,6679,6779,6984,6471,6886,6715,7054,6841,7096,7165,7363,6415,6790,6891,7244,6974,7139,7188,7485,6747,7217,7306,7447,7344,7520,7610,7857,3902,4404,4266,5085,4593,5185,5018,5637,4692,4948,5397,5945,5300,5712,5849,6266,4789,5343,5239,5758,5551,6139,5827,6342,5491,5898,6011,6490,6084,6403,6609,6898,4986,5573,5461,5922,5665,5987,6023,6424,5358,6066,6194,6613,6302,6567,6528,6945,5771,6201,6358,6516,6272,6665,6730,7037,6156,6774,6649,6993,6832,7101,7150,7416,5155,5419,5799,6188,5642,6119,6339,6625,5932,6445,6252,6569,5910,6698,6753,7050,5998,6309,6373,6909,6470,6719,6812,7262,6552,6876,6775,7092,6960,7142,7234,7463,6103,6397,6630,6817,6486,6997,6880,7175,6708,6846,7038,7199,6925,7359,7272,7507,6586,6989,7088,7286,7143,7398,7351,7582,7074,7315,7450,7646,7412,7547,7674,7889,5471,5721,5853,6327,6060,6540,6284,6770,5986,6409,6392,6864,6504,6936,6836,7226,6167,6655,6476,6822,6714,6895,7042,7194,6622,7002,7084,7275,6973,7319,7393,7579,6253,6562,6784,6954,6682,7097,7022,7311,6735,7046,7134,7477,7212,7352,7362,7635,6875,7184,7258,7390,7160,7510,7428,7617,7103,7443,7541,7731,7499,7659,7719,7978,6431,6763,6828,7179,6957,7083,7253,7401,6907,7130,7202,7435,7302,7533,7482, 7681,7031,7237,7312,7517,7355,7458,7575,7760,7367,7605,7550,7708,7621,7751,7784,8027,7147,7323,7404,7572,7441,7585,7653,7734,7492,7650,7615,7811,7693,7813,7776,7953,7540,7679,7725,7835,7755,7844,7870,7914,7788,7874,7897,7936,7918,8083,7998,8015,1250,1531,1587,1970,1656,1982,2124,2504,1739,2073,2184,2591,2316,2699,2751,3342,1843,2137,2219,2694,2391,2787,2949,3375,2475,2942,2861,3452,3097,3532,3603,4105,1906,2322,2434,2846,2489,2934,3020,3470,2626,3058,3118,3542,3281,3677,3738,4224,2713,3152,3328,3715,3369,3788,3857,4296,3447,3872,3953,4440,4004,4506,4606,5105,2045,2335,2559,3042,2646,3111,3266,3626,2767,3336,3169,3740,3429,3817,3923,4347,2892,3319,3436,3868,3508,3936,3987,4467,3583,4016,4120,4553,4217,4640,4734,5252,3041,3454,3549,3971,3683,4050,4171,4630,3769,4180,4292,4696,4355,4797,4871,5365,3890,4338,4452,4829,4481,4874,4968,5459,4586,5006,5075,5528,5147,5598,5711,6205,2253,2553,2661,3297,2817,3358,3391,3920,2960,3430,3514,3965,3588,4043,4084,4621,3091,3522,3610,4058,3722,4165,4274,4712,3810,4276,4344,4774,4458,4859,4951,5428,3189,3662,3777,4211,3827,4281,4372,4838,3955,4448,4489,4885,4583,5000,5047,5526,4067,4537,4633,5021,4701,5130,5156,5592,4807,5205,5320,5678,5399,5761,5920,6208,3251,3794,3930,4388,4034,4473,4569,5015,4112,4592,4655,5097,4735,5153,5247,5653,4260,4716,4776,5199,4876,5290,5380,5791,4937,5408,5482,5860,5550,5949,6005,6422,4367,4844,4920,5333,5027,5425,5495,5897,5145,5518,5596,5976,5684,6017,6144,6538,5237,5620,5714,6083,5748,6179,6229,6621,5908,6263,6312,6607,6375,6689,6794,7118,2404,2773,2855,3502,2967,3530,3635,4162,2983,3643,3747,4233,3841,4353,4394,4945,3174,3756,3850,4428,3944,4456,4528,4947,4009,4527,4613,5067,4718,5138,5174,5589,3227,3929,4024,4434,4138,4543,4639,5131,4200,4681,4742,5184,4795,5279,5348,5738,4185,4780,4852,5276,4935,5385,5435,5861,5035,5502,5555,5947,5614,5993,6097,6508,3350,4099,4139,4667,4251,4765,4847,5255,4298,4868,4906,5371,4976,5454,5512,5941,4601,4953,5029,5476,5107,5542,5612,5983,5215,5636,5724,6075,5798,6174,6238,6596,4760,5084,5188,5581,5273,5676,5733,6149,5355,5777,5818,6200,5923,6289,6334,6668,5488,5915,5953,6314,5985,6377,6298,6718,6116,6493,6539,6814,6553,6935,6992,7180,3420,4241,4265,4929,4546,4997,5044,5496,4673,5060,5112,5568,5213,5644,5720,6153,4745,5203,5265,5649,5328,5735,5804,6214,5409,5826,5894,6276,5978,6326,6418,6734,4943,5281,5342,5802,5430,5876,5961,6301,5563,5964,6010,6407,6117,6369,6519,6827,5669,6057,6164,6495,6217,6551,6602,6894,6290,6612,6610,6976,6723,7011,7058,7300,5078,5402,5504,5967,5641,6015,6095,6442,5726,6150,6185,6542,6256,6566,6608,6928,5806,6225,6305,6597,6346,6617,6727,7014,6438,6741,6789,7068,6861,7135,7174,7415,5942,6318,6394,6729,6515,6736,6844,7091,6534,6834,6902,7158,6959,7210,7280,7497,6571,6940,7005,7233,7045,7289,7257,7523,7115,7335,7368,7594,7429,7629,7676,7783,2575,2876,3026,3566,3135,3761,3852,4376,3220,3874,3948,4425,4032,4519,4535,5121,3245,4025,4089,4511,4146,4768,4813,5232,4314,4820,4928,5357,4983,5439,5509,5971,3261,4129,4244,4791,4330,4923,4958,5421,4378,5013,5052,5521,5128,5599,5664,6021,4450,5092,5169,5627,5259,5718,5763,6128,5296,5740,5832,6223,5854,6271,6320,6805,3667,4321,4360,4978,4433,5054,5124,5577,4561,5177,5221,5693,5311,5785,5823,6160,4664,5229,5340,5754,5416,5851,5867,6243,5473,5872,5889,6331,6052,6378,6480,6831,4751,5414,5447,5886,5540,5956,5969,6357,5607,6050,6102,6437,6192,6509,6544,6906,5691,6141,6219,6549,6293,6592,6674,6963,6390,6685,6744,7016,6791,7073,7145,7405,3698,4410,4521,5161,4647,5222,5325,5796,4726,5350,5423,5874,5490,5903,5928,6351,4866,5452,5534,5936,5605,6038,6087,6430,5685,6122,6187,6531,6246,6573,6645,6913,4962,5575,5661,6100,5768,6166,6162,6578,5808,6227,6268,6624,6361,6678,6702,7024,5901,6295,6384,6691,6432,6757,6793,7094,6491,6821,6878,7159,6972,7219,7285,7506,5038,5707,5782,6231,5865,6288,6364,6686,6035,6388,6451,6781,6461,6800,6857,7129,6059,6455,6489,6842,6585,6874,6946,7207,6663,6966,7001,7236,7056,7310,7341,7531,6124,6606,6633,6917,6713,6978,7010,7271,6746,7053,7100,7331,7146,7373,7422,7604,6884,7104,7164,7381,7230,7438,746

2,7664,7
274,7486,7521,7689,7562,7736,7775,7904,3835,4563
,4686,5352,4854,5444,5524,5990,4891,5547,5623,60
45,5698,
6110,6213,6648,5020,5667,5792,6155,5837,6283,625
1,6666,5879,6308,6372,6740,6444,6768,6809,7116,5
261,581
0,5881,6277,6032,6355,6396,6787,6043,6449,6475,6
811,6513,6858,6893,7187,6063,6503,6561,6889,6659
,6944,69
96,7240,6696,7040,7055,7318,7102,7343,7394,7586,
5303,6029,6037,6435,6071,6457,6527,6867,6137,658
9,6629,6
931,6681,6988,7048,7294,6382,6653,6717,6999,6750
,7069,7106,7338,6863,7111,7168,7384,7232,7431,74
56,7662,
6469,6755,6840,7071,6885,7154,7192,7403,6953,721
6,7248,7453,7290,7488,7529,7709,7007,7278,7326,7
519,736
6,7552,7584,7741,7411,7597,7626,7769,7645,7815,7
822,7969,5335,6078,6108,6640,6352,6671,6700,7036
,6411,67
38,6778,7082,6852,7123,7183,7397,6483,6806,6881,
7138,6924,7198,7251,7446,6991,7287,7245,7476,733
9,7526,7
561,7716,6664,6896,6943,7221,7021,7260,7321,7513
,7064,7328,7365,7553,7389,7565,7607,7764,7148,73
76,7419,
7591,7465,7634,7655,7799,7495,7684,7705,7836,773
7,7858,7863,7941,6752,6948,7059,7329,7120,7358,7
377,757
8,7177,7427,7440,7620,7479,7636,7691,7820,7190,7
474,7515,7682,7559,7710,7714,7861,7599,7743,7759
,7878,77
92,7908,7926,8007,7298,7546,7554,7730,7614,7745,
7771,7884,7643,7798,7805,7921,7841,7927,7971,803
1,7671,7
832,7854,7951,7881,7957,7985,8052,7896,7989,8004
,8065,8020,8077,8087,8126,3912,3704,3210,4723,36
25,4622,
4206,5494,3799,4222,4337,5312,4416,5004,4889,567
3,4048,4399,4510,4927,4628,5194,5057,5888,4802,5
113,524
5,5597,5369,6040,5772,6345,4127,4551,4644,5135,4
818,5210,5389,5717,4896,5457,5294,6206,5567,5816
,5911,68
03,4987,5406,5634,5852,5516,5968,6135,6581,5700,
6106,6036,6405,6241,6651,6463,7098,4303,4758,483
6,5332,4
966,5437,5587,5934,5096,5753,5463,6009,5668,6065
,6178,6487,5204,5561,5843,6130,5775,6329,6101,65
36,5652,
6190,6376,6605,6281,6865,6687,7334,5301,5835,570
5,6259,6020,6211,6423,6632,5906,6506,6311,6762,6
401,671
2,7039,6933,6081,6440,6523,6904,6579,6782,6829,7
133,6636,6969,6872,7279,7018,7464,7208,7656,4471
,4912,50
42,5531,5167,5617,5752,6147,5285,5940,5682,6196,
5821,6254,6360,6728,5376,5769,6022,6274,5892,647
8,6316,6
699,6069,6410,6564,6792,6511,6849,6952,7166,5480
,5988,5858,6367,6183,6447,6576,6819,6132,6658,64
82,7051,
6626,6899,6915,7246,6261,6558,6739,6950,6684,698
7,7085,7489,6816,7114,7028,7269,7181,7347,7392,7
698,560
2,6048,6222,6532,6115,6583,6707,6965,6300,6771,6
627,7153,6833,7000,7079,7317,6379,6673,6851,7043
,6929,71
08,7239,7364,6742,7201,7122,7445,7276,7414,7522,
7756,6453,6882,6961,7213,6780,7161,7255,7545,700
9,7308,7
354,7455,7178,7595,7498,7943,7057,7332,7383,7580
,7418,7528,7563,7812,7283,7623,7647,7729,7675,78
86,7773,
8070,4707,5119,5226,5759,5391,5955,5828,6344,544
2,5871,6170,6421,6027,6499,6565,6870,5582,6086,5
973,652
5,6177,6693,6465,6926,6287,6590,6726,6977,6638,7
127,7070,7481,5689,6198,6114,6804,6393,6577,6646
,6990,62
55,6676,6754,7223,6838,7034,7110,7369,6436,6869,
6785,7151,6962,7090,7231,7410,6911,7200,7264,743
7,7316,7
503,7588,7723,5789,6517,6237,6716,6322,6892,6766
,7162,6467,6818,6939,7117,6986,7211,7273,7466,66
00,7044,
6916,7349,6860,7228,7261,7568,7113,7307,7374,750
8,7413,7543,7628,7830,6670,7067,6981,7281,7144,7
337,743
9,7613,7218,7475,7357,7576,7387,7687,7651,7804,7
012,7425,7527,7669,7487,7637,7749,7796,7555,7733
,7699,78
72,7786,7850,7909,8081,5959,6363,6547,6866,6631,
6922,7080,7291,6711,7170,6955,7330,7030,7250,741
7,7611,6
494,6998,7060,7385,7157,7504,7353,7593,7249,7449
,7480,7677,7305,7742,7648,7970,6807,7095,7209,75
38,7297,
7460,7432,7721,7140,7493,7583,7663,7551,7692,776
8,7856,7378,7570,7524,7706,7612,7817,7748,7880,7
652,777
7,7833,7920,7806,7902,7986,8030,6879,7229,7324,7
490,7172,7622,7530,7728,7406,7542,7673,7761,7581
,7785,78
38,7937,7270,7638,7601,7791,7683,7853,7809,7932,
7738,7824,7891,7915,7871,8003,7976,8055,7452,771
1,7658,7
848,7766,7947,7827,7965,7624,7893,7864,7983,7877
,7994,8019,8141,7702,7940,7922,8035,7907,8011,80
45,8092,
7961,8040,8028,8109,8062,8161,8100,8173,5037,531
8,5511,6003,5659,6055,6172,6570,5744,6337,6120,6
732,624
8,6619,6796,7077,5841,6193,6428,6657,6303,6920,6

721,7126,6501,6856,6983,7345,6825,7167,7220,7511,5926,6416,6350,6777,6521,6845,6964,7242,6662,7047,6901,7189,7023,7277,7400,7574,6594,6994,6942,7267,7089,7370,7320,7548,7156,7386,7448,7772,7470,7661,7627,7847,6093,6448,6643,6918,6776,6970,7205,7303,6560,7003,7105,7348,7032,7430,7360,7602,6749,7136,7169,7502,7062,7399,7478,7672,7288,7516,7424,7642,7567,7701,7746,7901,6910,7197,7322,7454,7254,7539,7509,7720,7375,7618,7577,7694,7500,7752,7781,7887,7238,7632,7598,7762,7678,7826,7800,7933,7558,7793,7842,7999,7869,7975,7956,8074,6269,6798,6616,7086,6705,7314,7049,7472,6938,7125,7247,7459,7214,7421,7536,7724,6905,7379,7266,7587,7195,7514,7496,7754,7356,7560,7644,7704,7616,7787,7814,7924,7019,7299,7408,7544,7444,7668,7606,7831,7309,7592,7712,7803,7640,7778,7862,7948,7473,7696,7666,7819,7757,7895,7845,7967,7744,7867,7930,7981,7906,8006,8016,8115,7149,7483,7361,7657,7420,7625,7707,7851,7512,7782,7688,7837,7732,7876,7892,7987,7556,7763,7722,7903,7818,7883,7938,8053,7794,7959,7910,8002,7949,8026,8042,8090,7600,7727,7828,7923,7780,7934,7964,8021,7866,7993,7945,8039,7982,8048,8064,8107,7849,7968,7995,8082,8018,8057,8069,8129,7954,8076,8094,8122,8101,8135,8148,8178,6507,6855,6764,7259,6975,7313,7225,7534,7035,7186,7423,7670,7372,7569,7630,7795,7093,7395,7340,7590,7494,7747,7619,7823,7468,7649,7697,7875,7726,7843,7912,7997,7206,7505,7451,7660,7549,7686,7703,7852,7402,7717,7767,7913,7808,7899,7885,8010,7596,7770,7829,7882,7797,7931,7950,8033,7753,7962,7925,8023,7979,8050,8061,8117,7296,7434,7608,7765,7537,7740,7821,7917,7665,7859,7789,7900,7654,7939,7955,8038,7690,7810,7834,8001,7865,7946,7972,8086,7894,7991,7963,8047,8014,8058,8079,8125,7735,7840,7919,7973,7873,8024,7992,8066,7942,7984,8034,8072,8005,8105,8088,8132,7905,8022,8046,8091,8059,8112,8102,8145,8041,8097,8123,8153,8116,8139,8157,8181,7457,7573,7631,7816,7715,7890,7801,7960,7685,7846,7839,7988,7879,8008,7980,8078,7758,7928,7868,7974,7944,7996,8036,8071,7916,8025,8044,8089,8017,8098,8111,8144,7790,7898,7966,8012,7935,8049,8029,8095,7952,8037,8056,8127,8075,8103,8106,8152,7990,8068,8085,8110,8063,8133,8118,8150,8051,8121,8138,8165,8131,8156,8163,8187,7855,7958,7977,8067,8013,8043,8084,8113,8000,8054,8073,8119,8093,8136,8128,8159,8032,8080,8096,8134,8104,8124,8143,8169,8108,8147,8140,8162,8151,8167,8171,8190,8060,8099,8114,8142,8120,8146,8155,8166,8130,8154,8149,8174,8160,8175,8170,8186,8137,8158,8164,8176,8168,8177,8179,8183,8172,8180,8182,8185,8184,8191,818 8,81891

**Sequence group 5: Q5_16384**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1026,520,288,528,192,544,70,44,131,81,50,73,15,320,133,52,23,134,384,76,137,82,56,27,97,39,259,84,138,145,261,29,43,98,515,88,140,30,146,1028,71,262,265,2048,161,576,45,100,640,1025,51,148,46,75,266,273,517,104,162,53,193,1032,152,77,164,768,268,274,518,54,83,57,521,112,1024,135,78,289,194,85,276,522,58,168,139,99,86,60,280,89,290,529,524,196,141,1040,101,147,176,2049,142,530,321,31,200,90,1056,545,292,322,532,2050,263,149,102,105,304,4096,296,1030,163,92,1033,47,267,385,546,324,2052,208,386,150,153,165,106,55,328,1088,536,577,548,1034,113,154,79,269,108,578,2056,224,166,519,552,195,270,1041,641,1036,523,275,580,291,59,169,560,114,277,156,87,1152,197,116,170,2064,61,1042,531,525,642,281,278,526,177,293,388,1057,91,584,769,198,2080,172,120,201,336,62,282,4097,143,1029,1044,103,178,294,93,1058,644,202,2051,592,323,392,2053,297,770,4098,107,180,1280,151,209,284,1027,648,94,204,298,400,608,2112,1089,352,325,533,155,210,305,2057,4100,547,300,109,1048,184,534,1060,537,115,8192,1090,167,225,326,2054,306,772,157,2065,656,329,110,117,212,171,1038,776,1064,4104,330,1153,2058,226,549,1043,538,387,308,216,416,271,279,158,337,2066,550,672,1092,118,332,579,540,1072,2176,389,173,1037,121,553,199,784,179,228,4112,338,312,1536,704,1154,390,174,554,581,1046,393,2060,283,2081,122,448,3 53,2113,561,1096,203,63,4128,340,394,1049,1281,527,582,556,181,295,1059,285,232,124,2068,205,182,643,2304,1156,562,286,585,4099,299,354,2082,1045,4101,211,401,1104,185,1061,396,344,586,645,1282,593,535,240,8193,2072,1050,206,95,327,2084,564,800,402,2055,4160,356,307,301,417,1160,213,1066,568,1120,832,4105,588,1035,8194,1537,186,2177,646,404,2114,1091,227,896,594,418,2560,302,649,771,360,539,2059,4102,111,1052,331,1168,4113,214,309,1062,1284,2088,188,8196,449,1073,217,408,609,596,2116,551,650,229,159,4106,420,2178,310,1093,541,1288,773,610,657,333,1065,119,1098,2067,4114,2061,600,339,1184,218,2096,368,652,1031,230,391,313,4224,450,8200,542,1538,334,1076,233,555,2062,774,175,123,1155,658,2120,612,341,2305,777,220,314,2069,1105,424,1068,395,4108,673,4129,583,355,1296,2180,1094,4161,287,183,234,1051,125,557,1216,660,616,342,316,2083,1157,241,778,2306,563,8208,2074,1074,345,452,397,2561,4116,403,1112,207,2128,1540,4352,674,558,785,1100,432,1039,357,187,1162,236,664,1312,624,4130,587,780,1080,8224,2085,1122,705,2073,126,242,2070,1063,565,398,2184,346,456,2308,4120,358,405,303,569,2312,1544,4132,244,1158,1097,595,1283,189,4103,566,676,1169,8195,1054,1108,361,2086,706,8197,589,2562,1344,215,786,647,348,2144,2115,419,406,464,680,4225,801,2089,4162,1069,362,1164,590,409,1286,4608,570,1121,788,1552,2192,1106,4107,2076,597,1075,8256,572,1186,219,311,2117,708,598,2090,1289,601,651,421,792,4136,802,8201,2564,611,1047,602,1172,410,231,2097,4164,688,653,1128,248,1070,2122,4226,369,2320,190,364,1568,654,2208,1095,8198,659,1161,335,480,4115,315,4109,221,3074,8209,370,1285,613,2568,1408,4144,422,425,2336,451,1077,614,543,1298,235,412,2576,343,372,2240,1185,775,317,2592,4110,8202,2118,1539,222,1099,426,4168,2092,453,4353,237,1124,559,1170,2179,1292,4117,833,8210,804,712,1082,834,661,1053,808,779,2129,1217,617,604,2098,1541,433,4228,720,2121,816,1101,8320,2063,1176,836,2368,347,897,2181,1136,4131,243,1297,2100,662,4354,2071,1600,4122,454,318,675,1110,618,2182,1081,4609,898,781,1314,1220,376,428,1546,665,4176,736,8204,567,1107,8225,2432,1192,1078,840,2124,2185,625,8257,238,2130,1159,359,457,2104,399,787,2075,2145,4133,591,678,434,4121,677,2087,1290,4118,1542,349,1300,1102,245,4232,1188,458,4356,666,1113,620,1553,8212,1163,2307,1313,4360,363,2132,127,1067,8448,191,2186,1125,782,407,2193,436,626,2309,2077,1218,571,465,681,2091,246,4134,707,8226,2146,4610,1346,350,1084,599,668,2563,1548,4192,4163,790,1165,1320,460,1123,2136,1200,4137,249,2188,682,1664,8216,573,1171,411,803,2078,1116,8228,789,2194,1304,709,365,4240,440,628,4124,689,3076,8199,2119,374,1224,423,2310,1556,4165,466,793,2313,4138,1130,250,371,1174,481,574,1348,2209,4612,413,2624,1109,603,366,2093,1545,4145,8321,2148,1287,1055,8258,468,1570,655,900,4170,2688,805,4368,615,3073,8704,1166,684,1409,710,2099,1187,4256,429,8203,794,2196,252,1114,373,605,1232,848,690,2094,5122,2123,713,632,2314,1316,482,4616,806,2321,4384,1132,8232,2565,1083,427,2152,1177,904,4624,2210,1569,8260,4288,414,1291,2101,223,1126,4640,2241,1554,4166,663,3080,8322,692,835,1328,619,472,2200,1137,4140,455,796,2125,1189,1601,809,714,2212,1248,721,4227,837,8211,2816,716,1086,8205,2316,1302,1352,864,2322,2566,4177,8240,810,2102,1173,4146,606,1194,2131,912,4169,2105,2569,1103,4111,722,696,377,4416,1424,435,2160,1293,4229,1560,8206,817,1129,1792,319,621,4148,1180,812,4119,484,3072,8264,1345,430,1572,8449,2183,1138,2126,1299,4230,838,2337,2242,667,1219,8213,488,2133,1111,239,378,2324,2570,459,622,2106,2216,1410,4480,627,437,2187,380,4172,4233,8324,2147,1201,4178,1608,818,1178,1294,461,4152,2134,1543,4123,496,4193,669,1190,1317,679,1140,8227,1079,2108,1221,4135,724,8450,2328,841,1305,8218,629,2137,1584,351,467,2338,2577,1360,8705,438,2572,2244,1115,737,251,4355,462,2189,442,4180,441,3088,8272,2149,4234,1666,469,2195,1549,4241,247,683,2224,1196,4357,1226,4125,842,1412,1127,738,4139,1144,2190,1308,4194,899,2578,1602,670,1318,8229,783,2369,1085,4611,8217,849,2079,1555,1193,8214,820,2248,1576,728,928,4184,2138,8328,791,4236,367,3104,8452,2593,1376,901,1233,630,2340,2370,1321,4126,685,8456,844,2580,4242,1204,63

3,711,11
18,253,691,2311,1301,5124,2197,4167,824,2150,117
5,902,4358,686,2153,1668,4361,1222,8230,2352,141
6,1133,8
706,740,6144,1347,850,375,4257,2344,1558,8288,46
72,444,3078,8259,1306,2211,470,1167,4141,483,214
0,1547,4
196,415,3081,8233,485,2095,905,1202,795,473,2315,
1240,4736,634,744,2433,5121,2594,1616,852,960,23
72,1322,
865,4147,693,8336,2256,4244,1131,8220,2434,1794,
1350,797,2198,2201,1225,4142,8261,4171,2213,1604
,1571,82
34,4362,906,1252,2154,715,1141,4369,2103,2376,13
30,4613,807,3136,8708,474,636,4200,1179,694,254,2
584,155
0,4258,1665,8241,717,2625,1071,1315,575,913,4149,
2596,1440,798,4289,811,3082,8266,5128,2161,379,1
208,846
4,2202,1353,2127,1191,4248,697,2317,2156,4173,15
64,8352,431,2626,1142,4260,607,2272,1228,2214,48
9,4864,2
567,2600,1324,9218,4364,866,723,2243,486,4370,15
73,4614,8712,2318,1181,4150,1234,3089,8480,908,1
793,1561,
718,813,4179,2689,1364,4153,476,4617,856,3084,87
20,1117,1411,839,1329,8384,2571,1295,2323,1146,4
208,725,
8736,2628,2339,698,1472,8262,914,2107,1249,752,8
68,2217,2608,5120,2162,8236,819,2325,2204,1349,4
231,814,
4174,439,2135,929,4385,4290,3200,8323,2245,1197,
4181,1578,490,2164,1139,4372,1680,623,4618,2218,
1632,415
4,1336,8273,4264,671,1198,1362,739,1603,4235,824
2,1557,2109,1413,4195,916,3090,8265,2579,1303,46
3,1236,8
207,843,2573,2690,1135,4182,8512,381,2329,2326,1
672,1354,8325,497,2574,2225,1586,930,821,4156,23
41,8244,
2436,726,4376,961,3105,8215,2139,1203,4185,1182,
872,2632,2817,1418,4386,4625,8326,492,2246,1250,
4620,133
2,4292,631,1574,1223,729,4237,2220,1145,5136,216
8,1605,4197,700,2249,1796,443,4243,1307,8576,741,
2384,13
78,4272,1562,8268,8329,2110,1356,1205,8274,845,2
330,6145,1319,920,382,4238,2191,3077,8248,1585,8
219,4626,
822,3092,8289,2151,1425,2226,851,1229,4417,730,2
342,2141,1609,4127,498,3106,8231,880,2692,4296,1
256,742,
445,2250,1392,4186,471,635,2640,1148,5152,2371,1
696,4641,932,2440,1580,687,4388,4418,8451,2345,1
210,4628,
1420,8276,2818,1612,1325,1800,8330,903,6146,2155
,1134,4359,8337,825,4245,2228,1235,1361,8453,419
8,500,3
328,8221,1577,2199,846,1670,4201,2257,8235,2332,
1195,4400,745,3075,8290,826,2696,732,1264,446,96
2,2142,2
252,1426,4392,1620,8707,936,2346,5126,2448,1377,
475,853,4259,2656,1310,867,4188,637,3137,8280,51
29,2400,
4143,1551,8332,2373,1230,2581,1414,4363,907,2203
,2258,1206,4481,1667,8222,4642,2353,1588,1333,83
38,4420,
487,6148,1808,2595,695,1441,4304,2348,2157,1087,
9220,4482,746,3096,8263,828,2232,753,4246,1610,4
249,8454,
854,2582,1237,4261,1326,3108,8457,857,2585,1368,
1209,504,799,4202,2163,10240,1355,4151,255,4424,
964,313
8,8353,5184,2215,1242,909,1673,8768,2273,1559,23
74,1309,4632,719,8237,2354,2820,4673,1143,8292,4
77,2205,
1617,4644,915,2704,2377,1448,5130,2158,8832,4209
,2165,2260,1380,9217,4250,638,4175,748,2219,944,4
365,172
8,4204,3086,8243,2824,1331,4674,1227,3112,8340,8
69,6152,1592,4320,1428,491,699,4262,2378,1253,46
15,1351,
8238,4648,754,3201,8267,1183,1565,858,1618,4291,
8458,2274,1417,2597,1476,4366,478,3091,8465,2586
,5137,24
35,968,1260,8709,383,2356,2264,1212,4737,8296,91
0,2464,2319,5132,2327,1801,8354,815,2206,2385,15
79,4619,
976,4371,2598,8245,2720,870,4676,4387,3140,8385,
2166,1684,9224,4155,1633,917,2380,2627,1337,4265
,1241,46
56,8344,4210,2588,1606,4373,1824,3120,8269,4252,
727,1150,1442,493,1357,4183,8356,2437,1251,5248,
2221,167
6,4293,873,3085,8960,2169,1384,701,4212,1566,846
0,931,2601,2247,1323,4266,1798,8466,8710,2832,22
27,1365,
1473,8246,756,2276,6160,2386,1334,860,499,4157,2
360,3584,8275,5138,2752,8249,4627,731,3202,8713,
2438,164
8,2222,4621,1238,4738,823,2602,2629,1575,4377,43
74,3094,8304,922,2441,1199,4622,1674,4273,874,23
31,1432,
4389,1421,918,4484,2170,1636,5153,2496,1254,9216
,4187,502,2401,1795,933,4680,1366,4865,8327,8270,
2609,13
38,4294,1682,8481,3144,8386,2251,1587,1211,1488,
8277,743,2111,6176,2388,1358,4268,8468,760,4216,
2442,309
7,8714,1244,1581,8250,4297,881,3329,8360,2575,11
47,2630,494,1379,4432,2604,8331,2229,2343,1272,4
158,702,
3107,8291,921,2333,4378,1624,501,876,2280,2172,1
415,4239,5125,8278,847,2253,1856,5140,2230,1444,
4199,992,
4274,2691,1697,447,4390,4189,3204,8252,5154,2610,1607,4740,1436,8472,2334,1369,2633,1257,4298,1704,8281,733,6147,2347,1797,4688,1669,8482,8721,4419,2402,1340,1231,8716,4488,827,3093,6149,8388,1590,2259,934,1634,4393,2449,3152,8333,2233,1474,9232,4866,882,3109,8293,937,2444,2392,963,1419,4203,8339,747,2634,2693,1265,4276,1119,3330,8368,505,2641,5376,2583,1381,855,924,4247,2288,10241,1810,4305,734,4380,829,3098,8334,5123,2254,1563,4744,1213,8722,2143,1611,2375,1363,4190,4300,8513,2612,2848,1430,4394,1258,8223,4496,2450,1688,1386,8392,4704,965,6208,2404,1614,5185,2355,8282,1730,4448,2349,2465,1239,9248,4421,938,4629,3208,8737,884,2261,506,4251,1327,4306,3114,8484,8514,2616,1589,4401,1804,3168,8724,749,2880,6153,1370,1640,945,966,4643,2636,3083,10242,1456,4396,1681,8455,4205,755,3585,8341,5144,2234,1266,859,1427,4280,8294,2694,1593,2452,1388,4630,940,3139,8297,2275,5156,2944,4633,1214,8496,830,2642,2466,1809,4211,12288,911,2350,2697,1621,5186,2819,1582,8488,4263,2408,2587,1832,9222,4321,871,4422,6150,8355,2159,639,4402,1480,4868,3100,8284,2379,1698,9225,4253,1335,3216,8239,888,6161,2262,1372,4752,1245,4425,8459,479,4206,2357,1422,4213,1268,3110,8577,4308,946,3332,8738,1732,1677,750,1802,4267,8516,2236,10244,1626,5134,2497,1393,4872,969,3121,8400,2265,5160,2456,508,1613,8578,861,2657,2644,1446,4426,1857,8342,8345,2599,2698,5249,2277,1339,8357,757,2207,6154,2468,1382,4322,970,4645,2358,3141,8298,5139,2589,8247,4634,4483,3336,8520,2821,1700,2658,9280,4404,1243,4312,919,2705,2381,1594,4512,1433,4367,3113,8728,4375,2167,1826,4254,1504,3146,8769,4433,875,6162,1635,4646,1259,862,1920,4768,8740,2648,1675,5188,2387,1445,9226,4214,758,3232,8305,2266,1149,948,4428,1359,4675,8346,8271,2416,2700,1816,4636,1596,8461,3079,8300,2278,5168,2439,1671,1712,8770,977,2361,6272,2498,10248,1385,4485,8416,923,4269,2590,3586,8358,5133,2382,1622,8711,4217,972,3124,8744,2281,1434,2603,4649,1311,4295,2822,8387,2223,2171,1729,4880,4275,3203,8462,761,2706,9233,4324,1396,4434,877,2660,2389,1207,4408,1475,5632,8833,4800,2825,1449,5250,2268,1812,9228,4486,952,4270,2362,1686,495,4650,1262,4677,8715,3153,8467,5142,2472,1644,4489,1619,8772,3116,8483,2443,1341,6156,1429,4379,1825,8251,703,2721,6177,2631,1371,4218,1638,8361,8752,4544,2403,3344,8306,1567,1736,8469,4449,935,3142,6209,8348,2335,1685,2231,978,1625,4657,2282,3099,8279,2173,5192,2605,9344,4299,883,3264,8389,762,2708,2664,4159,1246,4436,8308,503,2390,2364,1458,4490,5145,3205,8362,925,2289,1394,5377,2826,1269,4623,878,4678,2611,10256,1478,4652,735,4277,4391,3122,8253,5155,2393,1799,9234,4381,1678,8723,2500,1860,2445,1443,4328,1637,4220,8717,8834,6164,2451,1481,4301,1373,8473,3160,8470,4278,2255,1699,1255,8718,4739,993,3588,6400,8369,2722,1591,5252,2606,8485,1828,4658,2833,3148,8580,2480,1452,9249,4382,885,4681,3087,8283,939,2405,2235,994,1400,4395,3210,8776,8961,2284,2712,1744,4450,1656,3360,8390,980,2672,6178,5141,2635,1689,926,764,4307,2828,3128,10272,1270,4497,5200,8364,4281,941,3170,8312,5157,2753,1628,4492,1367,4440,8393,2174,1805,2290,1457,4682,4741,3111,8528,2613,5378,2446,1921,4689,1583,8254,4631,2394,2504,1387,4336,1642,8474,12289,967,6168,2406,1267,5146,2453,1484,8335,9221,4302,2351,2617,1450,9236,4191,886,4423,3592,6180,8295,8370,2292,831,4660,1683,4896,3206,8486,3145,8285,2643,1342,9250,4498,1811,3331,8836,947,2237,6151,2614,1705,1431,4452,8394,507,4403,2724,3217,10243,1261,4397,1840,3102,8784,4513,889,3156,8515,5256,2409,1650,984,1760,4309,8584,2754,10245,1490,5162,2637,1615,4664,751,3392,8489,2263,5216,2834,4928,1702,8962,942,2695,2396,1858,4684,5131,12290,8299,2467,2454,1423,5633,2512,1460,8372,4282,2728,6273,2849,1383,9472,4742,996,4500,6210,3117,8343,5187,2410,8401,4323,1692,4992,3212,8476,2638,1641,2457,9219,4690,1814,4514,3334,8840,971,6656,2618,1477,4398,1273,4745,3169,8286,8396,4867,2836,1512,4456,1733,3600,8490,4635,890,3154,6155,8592,1598,1374,509,1806,4207,8800,2645,3123,10304,1922,5148,2620,1649,9281,4427,949,3234,8544,2267,5264,2359,973,1397,4310,8517,8725,2756,2646,1489,4405,1708,8347,3337,8402,2649,5158,2699,5380,2469,1627,8497,1000,284 0,6184,2850,10249,1690,4284,12292,892,4545,2659,3095,8739,5169,2650,1274,8492,4313,4504,3220,8301,2458,1438,2279,9240,4705,1817,4692,6212,8376,2736,2701,1390,4647,1464,4746,3176,8726,4325,2296,9252,4255,1868,3118,8729,4516,950,6274,2417,1151,4406,1731,5189,8307,1506,4637,2238,1827,5384,2412,1597,9282,4869,863,4706,3616,8359,2702,1451,759,4753,1864,4429,8417,3143,8518,10246,5161,2707,1714,4215,1701,8498,3209,8964,2383,5194,2528,6163,1395,1803,8349,1008,2363,6157,2269,10257,1623,4696,1482,8848,8521,4435,2418,3333,8302,5280,2661,1276,8309,4314,510,3456,6192,8404,2470,1435,2473,4464,1652,4748,2499,3125,8363,2662,5127,2591,9230,4326,4487,3346,8968,979,2283,2460,9256,4409,1492,4546,12296,953,2391,2420,1928,4638,1829,5634,3233,8522,4430,2823,1389,5172,2365,1738,9345,4329,763,4651,6158,10250,1872,4870,974,4271,1453,4219,8418,3587,8741,5251,2270,1643,9235,4754,1713,8730,3147,8579,2474,1818,6216,1215,4708,1402,4437,8500,8408,2501,6401,2285,1629,4873,1520,8608,3172,8463,4316,2607,3218,8471,1830,1691,8350,4410,954,3340,6165,8529,2881,10258,1459,5201,2852,8742,1734,4520,2760,3130,8864,2882,5164,2709,9284,4491,879,3101,8310,981,2856,2827,4769,1505,4679,3265,8524,8771,2665,2652,1706,4451,5392,3589,8732,982,2481,6276,9264,5190,2768,1924,4383,927,4279,2864,3149,10368,1833,4330,5147,8581,4221,4653,3224,8365,5312,2884,1639,9229,4756,1447,4712,8313,2395,1746,2945,1343,4438,1679,4412,8745,3184,8391,6179,5253,2291,1820,4337,1761,8976,3345,8371,4874,2710,6402,1479,4659,1275,8420,12304,995,3648,6170,8530,2502,1740,5170,2366,1401,8504,9728,4441,2723,3158,8896,2666,1888,9346,4548,765,4493,3129,6657,8582,8366,2946,2829,956,1496,4499,3362,8746,3268,8773,2424,5208,2476,9238,4303,1861,3594,8585,887,2713,6224,2784,5636,10252,1437,4770,8475,985,4654,2615,3155,10273,1720,4881,5196,3240,8314,4528,997,3126,8640,5135,2888,1630,4453,1813,4283,8545,2673,10305,1462,5258,2286,1398,4332,4760,3207,8753,2407,5408,2505,9288,4720,1645,8395,4683,2447,2835,1848,4876,1687,5176,8255,12320,8532,6181,2639,1247,5218,2726,1716,8586,9241,4801,2482,6169,2725,1936,9473,4222,986,4338,3338,6166,8719,3590,8774,5159,2397,8748,4661,1483,4494,3348,8373,3150,8487,2293,1651,6280,9251,4442,1745,4552,3236,8477,943,2506,6404,2714,1859,1508,4454,3161,8424,8316,4501,2668,3601,10260,1834,4399,1454,3211,8397,4665,891,3361,6408,8374,5640,2411,1841,998,1595,4340,8835,2175,3115,10496,1278,5254,2239,5193,9348,4691,766,3173,8754,2830,5379,2455,4285,1465,4662,8478,8777,2484,2674,1709,4772,5265,12291,3266,8491,2619,5150,2513,1764,5204,2729,1646,8546,4457,2294,6182,2755,10274,1737,4802,9237,12293,511,4685,6658,3394,8403,5440,2398,1485,8593,4311,9296,4882,3132,8377,2647,1404,2716,9253,4743,1693,4444,3596,6240,8588,8536,6211,2838,1866,4515,1952,4502,3213,8778,3368,8837,4560,2508,9474,4776,1491,3171,8785,4897,988,3248,6185,8727,2297,1657,1752,5165,8432,1807,4458,2730,3712,10264,1399,5260,2621,1844,9242,4686,1001,4505,3219,8398,2459,5382,2851,951,1654,4666,8287,3164,8519,10276,5217,2837,1926,4884,1707,8756,3352,8992,2757,5648,2413,6288,5202,2488,1391,8594,1002,2676,6172,2737,10247,1468,4693,5171,12352,8548,4668,2422,3272,8499,5282,2471,1836,8493,4315,4407,3604,6213,8609,2514,1494,2841,9352,4804,1873,4694,6186,3178,8405,2298,5385,2419,9258,4697,1271,4747,3222,8760,4517,2529,2622,9312,4888,1694,4898,3396,9024,12297,893,6660,2461,1923,4707,1461,5143,3157,8780,9227,4698,2651,1748,5268,2414,1715,9729,4506,975,4327,3593,6193,8378,10369,1862,894,4784,1815,4749,8838,3335,8596,3103,10306,5224,2516,1497,9283,4344,1653,8419,3618,9088,2703,5166,2948,6218,1510,1762,4465,8786,8610,2853,6416,2663,10752,1842,4286,1375,8494,3214,8841,4460,2732,3457,8963,5664,2758,1703,8552,4750,1009,3235,6304,8731,2477,10251,1466,5191,2842,12294,1874,4755,2300,3162,8303,2421,5257,2653,9244,4431,4576,3280,8523,955,2896,2738,9360,4411,1739,4317,7170,12305,8406,2761,2680,1486,4466,1930,5381,3364,8501,4709,2530,6664,9254,5504,2854,1889,9476,4518,1004,4521,6432,3180,10280,1658,4547,5173,8380,4710,1821,4639,3131,8641,5394,2475,1718,9265,4331,1929,4508,8409,3225,8600,2952,1599,6672,1507,4439,17
76,4468,8801,3617,8788,10308,6336,5281,2462,1405,4871,1735,8743,3339,8842,4413,2271,3174,6688,8421,1831,
1493,8351,12298,1010,3602,6214,8612,2711,10370,1984,5635,2740,1455,8502,9285,4318,2883,3376,8733,2667,5
195,2520,9480,4522,957,3185,6188,8965,8802,2503,2844,4549,1865,4333,3237,8849,3649,8525,2857,5220,2762,9
257,4655,5266,3296,8311,983,2769,6275,2885,9290,5388,10259,1710,4929,12306,958,4900,2764,3134,10253,151
4,4808,5178,3350,8792,4930,4757,3400,8531,5149,2912,1876,9376,4904,1768,4875,8410,6225,10288,1721,5313,2
858,1938,4713,1660,4700,8560,3221,8844,6194,5637,2654,9223,4529,1500,8422,3242,8583,4816,2960,6217,1403,
4912,1892,5197,8505,12416,8642,3151,6159,2770,1819,5272,2744,1741,8734,9730,4932,2425,6464,3472,8526,24
83,1516,9268,4443,987,4993,3341,6277,8425,3608,8747,10254,5232,2865,8966,1932,4339,3177,8367,3840,8315,2
367,5393,2669,6196,9347,4758,1463,3228,8850,1012,2860,6167,2532,5696,10312,1843,4550,3393,8804,8533,441
4,2478,3620,10497,1749,4771,5206,3186,8969,4714,999,3347,6278,8412,5177,2886,1838,4994,1277,4877,8506,27
15,3267,10261,1647,5410,2536,5316,9297,4472,4524,3159,8616,2287,5642,2426,9260,4761,1925,4832,8587,1230
0,2507,2670,1498,4663,1742,5203,8865,12321,3458,8775,6528,5288,2675,1513,5174,2485,1880,8547,9488,4936,2
428,6220,6281,10372,1717,4721,9286,12353,1016,4334,3249,6226,8479,3656,8375,5255,2866,1953,8426,4455,92
43,4553,3226,8317,3342,8749,2509,1837,6200,9408,4495,1867,4883,3591,6171,8852,8808,2544,6241,2717,1631,1
469,4687,3238,8534,3365,8508,4774,2727,3188,10275,9349,4530,1747,3127,8433,4773,767,3269,6183,8970,2772,
5386,10498,1904,5638,8755,1724,4445,2889,3353,10266,1524,5396,2677,5198,9266,4341,989,3632,8537,2399,52
84,2515,4554,1406,4762,8644,3408,8589,10753,5209,2486,1754,4716,5649,12308,3163,8595,2785,5259,2299,640
3,9304,5409,2510,1822,8399,4459,2490,6228,2489,10320,1835,4223,5163,9732,12544,8866,4287,6282,3714,8750,
5221,2517,1499,8977,4878,9292,4503,3597,6289,8624,2295,1944,2731,9231,4532,1863,4722,3244,6405,8549,327
4,8379,6173,5314,2890,9354,4667,1890,4561,3460,8428,3175,8856,4777,2786,6187,9504,4342,1467,4803,3192,88
16,12322,1003,3356,6242,8779,2947,1522,1763,5442,3650,8972,9272,4446,2718,3366,10277,1695,5180,2831,185
0,9314,4695,990,4764,3133,6659,8897,10265,5644,2897,1005,1937,4886,8318,3603,8434,3241,10262,5261,2868,5
416,9255,4556,1722,8757,3624,8590,2776,5219,2976,6232,5296,10376,1845,4345,8538,8648,2839,6284,2415,105
00,1495,4778,5760,12312,3424,8550,4669,2949,3281,8597,5267,2678,1655,8495,4507,4899,3369,6174,8761,2733,
10504,1765,5212,2892,9736,12324,1956,4885,6290,3252,8436,2681,5400,2759,9350,4805,9289,4461,3166,8787,4
536,2301,2739,9475,4724,1487,4785,3349,7172,8381,12295,8758,6215,2872,1750,4470,1869,5320,3223,8868,936
1,4519,2950,6406,9246,5652,2734,1521,9300,4562,959,4889,3716,6409,8553,3270,10278,1896,5226,8898,4346,12
63,4467,3464,8781,3181,10754,5270,2788,1940,9536,4577,1770,4670,8407,3395,8978,2898,5444,2423,6305,1877,
1509,4509,8839,3606,8540,10336,6720,5205,2492,10307,1711,4699,1756,8611,3354,8598,4462,2518,3215,6189,8
656,5641,2531,1846,8872,12417,1011,3595,6244,8993,2463,10281,1960,5383,2533,5151,12354,9261,4564,2953,3
250,8554,2843,5666,2521,9356,4751,4996,3288,6784,8782,8601,2682,2792,9478,4901,1784,4711,7169,12800,366
4,8762,2900,5262,3008,9313,4780,1870,5505,3370,8980,4806,2913,6195,2741,9744,5283,10384,1662,4525,9298,1
2299,1013,4890,6292,3179,10268,1985,4348,5210,3842,8789,4469,9267,4701,3398,8764,5328,2845,1753,9378,49
44,1927,4786,8411,3273,6190,8503,10309,1528,6219,1849,4809,1882,4728,8900,3652,8790,3619,10282,6410,541
2,2954,9481,4578,1766,8793,3300,8843,4902,2763,3189,6417,8613,1511,1954,5228,8984,12328,8994,3378,6661,2
855,10756,1719,5179,2522,1777,8803,9239,4523,2684,6248,3227,8794,2742,5273,2302,9364,5000,895,3598,6306,
8602,3713,8423,10289,5665,2765,12356,1439,4510,3119,8880,3363,8845,2623,5387,2961,6197,9320,4319,5222,3
488,8440,1006,2846,6337,2859,9262,5650,10314,1878,4759,7176,12418,8561,4788,2427,3256,10512,1891,4931,5
424,3401,8382,4715,4568,3239,6296,8556,5233,2745,1939,9760,4551,1661,4892,8846,6221,3612,10400,1502,5285,2479,5697,9287,4905,1986,4810,3190,8851,6308,5344,2655,9353,4817,1852,4933,8527,3276,8672,12307,2537,6912,1934,4812,1723,5182,8507,12301,3372,8413,11266,6412,5398,2914,1772,5448,2771,1515,8562,9477,4960,2534,6418,3621,6662,8805,10760,1897,9600,12336,1014,4906,3229,6198,8614,3282,8617,10528,5269,2956,1470,8643,9269,4702,3841,8806,3609,8735,2766,5290,2861,6227,9490,5008,1743,3412,6201,8427,8604,2524,6665,2904,5199,10768,1931,4818,3165,8535,3459,8564,4792,2887,3377,10432,9377,4473,5520,3343,8967,4531,1017,3194,6256,8509,2773,5389,10784,1968,5656,12302,1881,4913,2746,3520,10310,1894,5225,2962,5888,9731,4415,4717,3297,8414,2800,5276,2916,9291,4908,1769,4580,8618,7168,12360,10284,5441,2867,1517,4526,1778,5668,8645,12545,3397,8429,6279,5234,2862,6222,9316,5395,2487,1941,8751,9362,4934,2977,6433,6338,10371,1823,4763,5315,9484,12309,9025,4584,3245,6229,3626,8996,5207,2538,1659,8904,4335,9274,4474,3187,6420,9026,3728,8853,2671,1992,6666,9245,4555,1875,4718,3680,6202,9000,3384,8971,10321,6312,5506,2719,9409,1755,4723,3246,8809,3410,8796,4533,2787,3651,6283,10290,9733,4476,1501,3605,8625,12420,1018,3461,6243,8912,2964,5297,10313,1900,5704,3351,9008,9293,4914,2511,3284,10255,1725,5274,2891,5390,9368,4557,991,3183,6230,9028,10560,5639,2429,4592,1933,4765,8539,3720,9089,3402,10373,5286,2545,5413,9328,4775,5236,12323,3634,8435,2978,5175,2869,6204,9489,5317,10292,1839,4820,8854,12546,2774,6424,3009,10263,1525,4937,5401,9792,12314,3251,8646,4725,6233,3230,8510,5680,2920,1955,8867,4447,9302,4563,3466,6434,8810,6673,10374,1988,5456,2540,9273,12801,1884,4534,3298,6668,9090,3380,8973,6340,5211,2679,9506,4833,9412,4347,3622,8568,3271,8620,4558,2777,6285,9738,4538,1726,4537,3193,7184,8857,12368,8928,3653,6245,2748,1948,1780,5762,3844,8759,9299,4565,2491,6291,3355,10624,9384,5645,2789,1518,9270,4343,1020,4779,3426,6320,9032,3610,10316,5292,10377,5322,8817,1767,4938,3404,8430,3253,10322,5508,2893,5223,9351,4834,1905,8551,3367,8649,2968,5240,2430,6286,5404,10296,1851,4995,8591,3633,8979,10267,6674,5698,2870,10337,1893,4766,5414,12325,3473,8783,4879,2899,3277,6465,8870,5181,2778,1945,8626,12313,4945,3657,6175,8869,2546,10279,1757,5651,2928,5289,9482,12310,9734,4916,6344,3304,8541,2790,5672,2493,9492,4824,9294,5024,3440,6234,8437,12424,2519,2683,9380,4887,1530,4463,3196,7200,8650,12548,3744,8858,6689,5472,2980,9305,4997,1958,5329,3628,8812,9745,4726,2735,6436,6466,9355,5417,10499,1471,4781,9505,12552,1007,4940,3258,6676,8555,3468,10324,2000,5300,3660,8319,4729,9259,4807,3373,8383,3848,10378,5214,2951,1847,9317,4349,1898,4787,8974,3182,6407,8599,10385,5397,2873,6293,1523,1942,4920,8628,3283,8818,3409,10501,6246,5271,2548,10269,9410,4998,1961,8763,3625,8657,4782,2894,3718,6249,8873,5764,10283,1871,5318,8438,12326,8899,3243,6448,2793,10338,1771,5512,2874,5229,12802,9538,4836,2780,3312,8542,2494,5443,3010,9276,4946,4471,3474,6440,8791,3668,8860,10755,5654,2984,9740,12384,1529,4540,7174,12355,3425,8982,2523,5402,2901,6307,9357,4566,9512,5263,3358,8652,4579,2915,6236,2685,9315,5643,10328,1912,4511,7177,9392,12329,8441,4581,6191,3599,10380,1758,5001,5298,3278,8874,4891,9856,4569,3462,6411,8765,5336,2955,1989,9363,4730,1946,4840,8603,3254,6529,8995,3715,10270,1526,6690,5712,9308,4948,1906,5056,3636,8981,3381,10386,6468,5418,2535,9496,4961,1883,4789,8901,3856,8557,12432,2743,3489,6352,8632,1773,1957,5227,8820,12316,3135,8881,11268,6530,5890,2794,10311,1853,5446,2876,1976,8566,9416,4893,2801,6294,3658,6297,8615,10502,5321,2902,9748,12357,1015,3285,6309,8658,3374,8985,10505,5700,2905,5667,12330,9322,5002,3416,8442,3257,8563,2552,5348,2847,6250,9366,4811,5237,3403,6199,8673,8766,2303,6472,3012,9540,5426,10401,1751,4903,7232,12804,3290,8605,4570,2957,3721,10816,9301,4732,5275,3607,8795,4790,4350,3357,6680,8558,2767,5646,10285,1993,5761,9737,12337,1503,4813,6721,3191,10340,1962,5167,2525,5411,9479,4671,9247,5009,3665,8660,6692,5536,2963,9762,4894,1781,4907,8847,3496,7178,9092,12362,10880,625 7,1885,4475,1908,5304,8997,12560,3428,8807,11265
,6298,5449,2686,6223,9358,5287,2796,2016,8876,96
01,4793,
2992,6413,3776,6252,8902,10291,1854,5660,9379,12
448,8621,4527,3379,6722,3275,8986,10388,5238,291
7,1532,
8444,9306,4703,3640,6368,8565,3476,8797,2539,532
4,2747,6310,9424,4585,1972,3301,6663,9040,3399,8
882,102
86,6696,5420,2802,13314,10315,1774,4962,3231,890
5,3613,8824,4819,2906,3666,6339,10506,9508,4582,
5669,34
65,8674,12808,1019,3524,6414,8998,2526,5277,1051
3,1895,5330,7185,12576,9324,5004,3016,3308,10757
,1987,5
889,2431,5657,9275,4814,4909,3260,6785,8619,1034
4,5460,2958,9369,4572,1969,4952,9096,7180,12816,
3849,10
402,5213,2863,5507,9761,4935,1782,5425,12480,362
7,8606,6667,5391,3024,6419,9483,5242,10293,1279,
4821,84
15,9318,12832,2918,6724,6435,10433,1943,4794,556
8,9746,12358,3732,8855,5010,11272,6203,3681,8884
,5345,2
965,1899,9027,4848,9520,4964,3385,6313,8811,3289
,6704,8664,10392,1994,6258,9329,12332,1663,4915,
3654,64
21,8647,3872,8988,10317,6300,5445,2775,9381,9793
,4910,3198,9001,3490,8906,4535,2541,3405,6231,10
404,944
0,5025,1964,3299,7296,8913,12419,9029,3724,6341,
2921,5293,11008,1785,5674,3432,8908,9278,4586,27
49,6260,
3614,10508,9494,5235,2979,5776,9544,4719,1021,33
71,6314,9056,3846,10514,5728,10758,5432,12369,19
35,4767,
3413,9002,3521,10294,5294,2804,5458,9365,4835,56
99,12338,3382,8798,2908,5653,2547,6205,9386,5509
,10323,
1886,5012,9104,7186,12361,10297,6675,5399,2779,1
0761,2001,4559,5332,9295,12303,3696,8914,4939,66
69,3286,
6786,8888,5231,2871,1407,8569,12608,9616,4477,36
23,6425,8627,6422,10352,1779,5768,2970,5450,9485
,12421,
9752,4593,3247,6670,3722,9009,6321,5682,2922,932
1,5026,9984,4917,3480,6437,8511,3469,8813,12340,
2966,65
32,9372,4822,1990,5057,3684,7201,9004,12311,3302
,8676,11264,6235,5299,2550,9537,1970,5278,3843,8
622,976
4,4968,2981,6728,3414,6913,10375,9330,5514,10318
,1879,9491,12422,1022,4588,3386,6342,9030,3730,1
0529,53
46,10434,5428,3635,8859,9411,4727,3259,8680,3536
,10325,5670,2791,5319,9303,4825,1902,8431,3406,6
316,857
0,10516,5241,2808,6264,5701,10762,1947,4796,8651
,3292,8814,3629,10298,6345,5892,2929,10408,9602,
4539,54
03,12672,3195,8819,4837,2542,3427,6480,8629,5474
,10379,1759,5658,8572,12364,12425,3320,6206,2750
,10339,
1907,5452,2969,5301,9393,12370,9800,4941,6426,36
72,9010,2549,5415,2924,9370,5016,9486,4478,3463,
6287,86
53,7173,12344,10326,5681,2895,9735,12315,1527,49
18,3904,7188,8688,12385,3492,8861,6247,5521,3040
,6322,9
382,4947,9509,5325,3745,8871,9332,4826,2495,6438
,6237,9271,5705,10300,1996,4594,7202,9413,12327,
8916,49
76,3655,6788,3484,10520,1786,5352,3417,9033,4838
,9497,4541,3305,6346,8821,3752,10329,5488,2781,1
959,977
6,4567,2002,4731,8543,3845,6736,8659,3717,10530,
5244,10769,6467,5792,9552,1913,5028,3388,8630,32
79,1076
4,6536,5676,2875,10436,9307,4783,1949,8929,3638,
8443,12547,2982,3682,6441,8654,5306,10381,2017,5
516,863
4,12372,3522,8633,11280,6914,5708,2930,10341,153
4,5421,2985,5896,12426,9858,4999,3011,3467,6251,
8661,10
387,5230,2795,9741,12433,4921,3313,6324,8439,316
7,8875,10416,5331,2553,5457,9388,12549,9418,4596
,7424,1
2317,3429,9034,2903,5673,2972,6295,9604,4942,931
9,5766,3858,6353,8930,12331,2782,6428,2877,9336,
5291,10
382,1788,4841,7171,9500,12386,3611,9091,4922,679
2,3261,10770,9794,4828,5360,3659,8862,4542,9510,
5058,34
11,6238,8975,6348,5522,10561,1910,5716,9277,1280
3,1965,5032,3478,6442,9041,3306,10271,2004,6544,
5473,97
47,4571,9385,4949,3736,9012,3434,10440,6752,5406
,3013,9768,4963,1901,4733,8920,3662,7233,9120,12
376,103
30,3778,6496,1966,1775,5647,8983,12428,3287,8559
,11296,6469,5326,2986,6677,10785,9568,5510,2932,
2008,90
93,9425,5003,2554,6299,3375,6354,8822,10532,5302
,10562,5763,9513,12318,8877,3637,6449,3852,9036,
10772,5
684,2797,5429,12434,9396,4583,3418,8825,3688,890
3,2993,5904,3014,6691,9310,4791,5537,3504,6444,8
445,372
9,8883,10503,6253,5183,2803,9493,13316,10389,153
1,4842,7192,12359,3314,9016,4924,2907,3475,6328,
10342,9
367,4849,5706,3641,9094,12550,4950,3436,6678,887
8,2988,5333,10345,1971,5422,7204,9860,12553,9414
,4953,6
681,3262,10544,1950,5464,2878,5305,9608,4600,932
5,4895,3857,6259,8932,14336,5451,2959,9539,4351,1909,50
60,9042,3669,7234,8567,12449,3630,10536,6311,533
8,9750,5005,1991,5769,12864,3880,8636,11270,6369
,5655,2
919,6470,9498,5405,10403,2018,4815,8662,9359,123
33,2687,6450,3528,6916,8675,10332,1727,5239,9739
,12388,
3746,8607,4573,11273,6301,3383,8677,10287,5713,2
936,1916,9097,9394,5011,3420,6800,8987,3293,6473
,8665,1
0507,5544,2527,6254,9432,12928,1855,3470,6261,88
26,3316,8936,10625,6356,5476,2994,13313,10786,98
08,4734,
3780,9044,3725,9152,4844,2798,3850,6315,10564,95
14,5040,5824,3674,7182,9057,12339,8885,3441,6920
,3017,5
427,10448,1974,5323,7208,12436,9323,4965,2556,36
61,10626,9986,5688,2909,5524,9542,4587,4795,3494
,6474,8
989,3905,10390,5349,10393,5447,9417,12334,1995,4
850,7297,12363,3387,10405,5279,2805,5661,9796,49
54,9763,
5714,12554,3430,9098,6370,5513,3018,6693,9444,55
72,10346,2020,4574,8907,7187,9333,12561,10295,66
82,653
1,10568,1977,5064,5356,9522,12805,3748,8999,4479
,11328,6452,3291,6360,8666,5308,2967,1787,8828,1
2392,93
71,5006,3642,6560,8886,3481,6415,8446,10776,1914
,6423,5897,9742,12450,9857,4911,3874,6302,3552,8
909,108
17,6481,5675,2923,9263,9507,5072,3683,6694,8767,
3307,9105,12341,2910,3968,6816,10788,9632,4966,2
005,372
3,7236,8990,12481,3493,9003,11274,6262,5780,2806
,13320,10353,1887,5729,3197,8571,9400,5013,2996,
6476,34
07,6723,10394,9545,5433,10319,5337,9383,12440,10
23,3864,6684,8889,3644,10509,5702,10348,5920,721
6,12365,
9756,4823,3719,8623,3760,10818,5246,3025,5538,93
34,4589,5453,12452,3433,6533,8799,10464,5347,297
1,6317,
9420,5772,10406,1963,4969,8681,7181,13056,3670,1
0759,6265,5480,3020,10792,9516,4797,5662,12556,3
482,905
8,5027,6697,3359,6343,8915,5419,10435,1998,5894,
8678,12562,9765,12806,3777,6928,6323,10510,1783,
5461,28
09,5569,9373,12342,9426,4852,11281,6372,3444,910
0,6482,5430,2925,9985,4956,9753,4595,3255,6456,8
910,352
3,7680,9005,12371,10881,6848,9556,12345,2024,482
7,3497,7298,8668,12809,3860,9048,11276,6534,5744
,3000,6
318,9309,9603,5334,3734,9031,9521,4919,2543,6698
,3310,6725,10763,9487,5671,10515,1980,7190,9338,
12400,8
917,5018,3692,6537,3667,10820,5295,10531,5770,33
89,8890,9664,4970,3477,6427,9106,3873,10299,5528
,2751,5
517,9441,5014,1903,8944,3419,6266,9060,3686,1040
9,5732,10800,6592,5350,13312,10354,1973,4598,361
5,9011,
3784,10517,6497,5891,2983,10396,9541,5029,5462,1
2423,3733,9006,12366,3026,3673,6705,8631,5434,10
327,200
3,5778,9121,12577,7240,12482,11392,6347,5683,293
1,10437,1789,5307,2810,5584,9389,12373,9770,4839
,6207,3
294,6484,8682,10356,5454,2551,9331,12564,9872,48
56,3506,6538,8815,7193,12810,10410,5340,2973,567
7,9824,
12346,9528,4977,3442,7425,12456,3317,8863,6671,5
243,2926,6726,9390,4590,9554,5475,3526,6700,8931
,9795,1
2427,2783,6325,6439,9749,5368,10301,1997,4798,72
03,9605,12387,3847,9108,5017,11282,6429,3726,107
71,9495,
5720,3908,8655,4597,9428,4972,3491,6376,9035,368
5,6268,10765,5511,10882,2032,9327,12374,1978,494
3,3529,
6349,8573,3421,10521,5952,10518,6326,5540,9864,9
546,5088,3747,8689,3303,10766,6787,5793,3041,104
17,9778,
4543,1917,9122,3639,7300,9013,12348,10533,3876,6
706,5703,10628,2010,5532,8918,12568,3500,9153,11
297,64
30,5465,2933,6729,10331,9395,5353,2987,5800,1237
7,9374,4829,3042,3448,6443,9064,10824,5893,11009
,5765,9
610,12578,12817,3792,6498,3704,8684,10438,5436,3
028,5327,9442,12812,9524,4923,7189,12484,3737,88
23,2974,
5686,2812,6355,9766,5030,9415,5730,3318,6545,892
1,7248,12429,10412,6329,5570,2989,9337,13328,103
60,151
9,4978,7205,9797,12389,3676,8892,5033,6540,3415,
6488,10441,9988,5059,5515,3853,8635,12435,9499,4
843,350
5,6730,8933,6789,5361,10576,2019,5215,7426,9570,
12464,9754,4601,3969,6737,3631,10302,2006,6679,5
477,954
8,4951,9397,5020,3435,6384,9037,3690,10522,14337
,5906,3015,9511,4830,1951,4925,9112,3315,7194,85
74,1243
0,3532,10383,11269,6350,5659,9777,1911,5309,1281
8,3498,9014,11284,6239,5707,2934,6471,10343,9617
,5459,1
0418,2021,9043,9421,12609,2879,6708,3731,6944,89
22,10534,5526,10333,5354,9801,12319,3390,8690,11
298,654
6,3859,9072,10884,5784,2995,5482,12488,9448,5061
,3753,8934,3479,6500,8637,10442,5710,2555,6451,9
584,123
78,5826,3309,6445,8663,3888,8827,10832,6561,5335,2937,9340,13344,10563,9888,5034,7304,12833,3698,9124,4 980,3032,3808,6357,10632,9772,4602,5423,3538,7210,8879,12580,12610,3663,6712,2799,5685,10537,2009,5900, 7264,9402,12820,9612,4845,6976,3750,11010,9804,5466,2990,5736,9517,5041,9992,5062,3906,6732,9095,7179,1 4338,5552,10347,5777,9326,12551,1790,4851,3471,7681,9017,12437,3508,10420,6330,5362,9427,4955,9553,5523, 12390,3431,8692,11520,6790,5689,3044,6548,9769,5484,10391,2026,5036,9038,7235,9862,12393,10449,6371,37 40,7040,10524,1975,5310,9387,12592,3689,8937,4926,11267,6738,3862,6562,9018,10888,5905,3019,2012,8924,9 456,5007,3525,6446,8638,3321,6793,9154,10334,5717,10444,6915,5678,9618,12584,9812,3560,6504,3781,9128,1 0538,6683,5928,2938,13318,10640,9569,4967,3646,8667,3422,9045,12451,2557,3854,6255,10848,9502,4735,5576, 3970,7196,9059,12380,3697,8829,11329,6475,5794,2997,13321,10592,1967,5431,7312,12335,9743,4984,3021,34 45,6358,10565,9422,5468,10773,5341,9606,12555,4575,3537,6453,9099,3756,10395,5518,10450,5364,7206,9398, 12673,9859,5042,7428,12834,3675,10545,5828,3048,5773,9780,4846,9525,5898,12612,3738,6332,8679,14340,572 2,2940,6593,10000,5489,10787,1915,5065,8887,7217,9633,12496,3322,10540,6361,6552,10349,9279,4604,5709,1 2674,3486,8938,4957,11288,6753,3865,6740,9020,5542,10424,2025,5953,8945,12438,9802,12441,3438,6695,3512, 6794,9046,10774,2022,6373,5435,9429,12453,9518,4853,11300,6303,3916,9049,10777,6564,5478,2998,9560,940 1,5066,3199,6454,8696,3779,7237,8991,12394,10355,3554,6685,9547,12343,1981,3875,7432,8447,12616,3645,91 56,11330,6917,5796,2911,6754,13376,10407,9434,5339,3499,9101,9865,5015,2807,6801,3912,6477,10465,9751,5 690,10566,5529,7209,9501,12824,8911,3762,6263,3749,10546,5922,11012,5600,7242,12865,9335,4971,3443,8669, 3851,10397,5731,3056,5355,9809,4958,6016,12836,3671,6744,9107,3530,10896,5771,10569,6483,5541,9640,133 22,10350,1918,4854,7328,12401,3324,10357,6362,5245,2558,10452,9572,5044,5455,12442,3483,8830,12367,6512, 3700,6796,8940,5912,10411,2033,5692,9136,12557,7175,9920,12396,11278,6374,6535,11016,1999,5767,3 027,58 08,9523,12866,9419,5073,11304,6457,3540,6594,9061,14344,5481,3001,9784,12512,9620,5019,3976,6686,8683,3 877,7682,8891,12454,10570,6478,5718,9445,12807,9543,5068,3437,7220,12840,3786,8946,11393,6377,5530,2811, 6699,9375,9757,5407,3920,6918,9050,9810,12483,3022,6319,3501,6267,10466,9609,5825,10789,2028,7299,9668, 12558,3691,8670,4857,11283,6802,3761,10778,13329,10627,5492,3866,9160,9452,4973,3263,6756,8575,3450,648 5,10548,5303,10456,5571,9404,12929,1533,3677,6921,9102,3568,10656,5545,10511,6364,5908,13324,10519,9993, 5048,3878,9007,3739,10398,6458,5782,3002,10577,9771,4591,5358,12811,3507,7249,9168,12563,10790,3782,65 68,5740,10912,2011,5715,9062,12868,7212,12579,11332,6539,5437,2927,10358,9876,5525,3029,5921,12347,9825, 4799,6817,3553,6727,9109,10572,5467,10819,5734,9529,12457,9433,12848,3754,6499,7440,12402,10780,5663,3 030,5832,9798,12565,10016,5031,11312,7238,12444,3972,8919,6431,5781,2975,6327,9342,5074,9634,5721,3881, 6378,8685,7195,9549,12375,10629,6269,6701,9443,13440,10413,1982,4979,7360,9868,12485,3687,9065,4858,112 77,6804,3495,6760,10361,9576,5342,3794,8893,12404,9758,4599,3391,6486,9123,3727,6460,10793,5554,10439,2 034,7301,9515,12458,9990,5021,3868,6385,3809,11024,5490,10419,6922,5365,9557,9665,4974,3527,6707,8948,3 323,10468,14352,5574,3043,10578,9526,4831,1979,9052,3788,7218,8691,12349,3449,10552,11776,6489,5895,133 30,10944,2023,5774,12819,3936,8923,11394,6596,5956,2813,6541,10630,9840,5539,10414,5733,12813,9430,1293 0,3004,3544,6547,9015,10794,5577,10821,5469,9767,12569,7256,12566,11286,6351,3909,9114,10633,5795,2935, 5351,9391,12814,9866,5089,7684,12465,3485,6818,9066,10523,5687,3033,6702,9624,12581,9613,5924,3768,6929, 9110,7244,12676,10362,6576,5548,3045,9828,13345,10688,9446,4981,7183,12379,3678,8694,5035,6501,3861,63 31,10593,9987,5090,5496,3510,7306,9125,12872,9558,13057,3446,6380,6808,5840,10801,2013,5752,7456,9530,1 2486,9874,5076,11336,6768,3693,10443,9779,6731,5785,9403,5022,9680,4860,3896,6924,8935,3735,7224,10303, 14368,5366,10580,9550,12460,2036,5037,3295,7266,
8952,12408,3764,10634,11289,6849,5724,9436,9773,
5463,12
489,3984,9073,11521,6270,5901,3034,6386,10767,93
39,5553,10822,2007,8686,7207,9571,12624,10796,67
09,3531,
6542,10421,6017,10535,5679,9464,12350,3699,8894,
11299,6490,3793,6600,9113,10525,5483,2991,5738,1
2570,9
816,5063,3907,8693,3556,6502,9068,10472,5363,103
64,6549,5580,9607,12431,13317,3882,6447,3502,903
9,10445,
6713,5546,2939,10048,13332,10422,9636,4982,7688,
12391,3889,9184,12466,3046,3643,6388,10883,9889,
4927,5
779,3326,7302,8639,12582,7241,12381,11396,6739,5
438,2814,13346,10802,2030,5907,7427,9799,12932,9
628,504
3,6333,3513,6710,10526,9561,5801,10825,5527,9449
,12490,9896,4603,3757,6820,8925,7313,14339,5357,
10539,5
936,7198,9989,12880,9861,4985,3812,7252,12611,36
94,10594,6505,5746,9532,5080,9423,5856,12680,378
5,6850,
9019,11285,14341,5586,2559,6733,9782,5711,10451,
2014,4847,9126,7488,9826,12585,3533,10641,6359,1
1344,69
30,10425,9666,5798,13058,3452,9074,5038,11301,67
91,3741,6492,9129,10636,5954,10584,2040,9155,961
1,12395,
3914,6563,4000,6550,8939,10826,5519,10885,6608,5
556,9457,12468,9311,11522,6824,3539,8697,10833,6
945,54
79,3036,13568,10775,9573,5092,3705,9047,3800,721
3,9116,12439,10480,3855,6506,10002,12497,5788,34
47,7308,
8926,12572,3892,9021,11290,6734,5737,3049,6553,1
3315,10446,9755,5910,7430,12936,9405,5067,2999,3
702,67
14,10335,9803,5573,10567,5369,7265,9555,12382,12
492,3974,6932,3755,10804,5608,11040,5829,7696,96
22,1258
6,9450,4986,7250,12688,3439,10642,5694,3050,5470
,9880,4605,9578,5902,12896,3516,6741,9157,7219,1
4400,60
18,10596,6716,5745,9806,13377,10547,1535,5045,73
30,9922,12640,3884,10541,6363,6455,10657,9431,50
69,5493,
12613,3542,9130,12821,11400,6852,3921,6742,9076,
5585,10453,2027,5804,8698,12443,7433,9519,12498,
11306,
6745,3319,6795,10808,2029,6565,5723,9781,12593,9
996,5096,11360,6936,3742,6946,8941,11072,14345,5
786,294
1,9562,9832,4988,3971,6755,9137,3509,7191,9158,1
2835,10828,11275,6746,5370,9648,12588,9873,3796,
7316,12
397,3763,8947,11777,6554,5534,3023,6375,13336,10
426,9458,5913,3910,9051,9619,12472,2942,6832,386
3,6797,
10886,9785,5486,10644,5560,7272,9580,12822,3545,
9132,11331,6392,3701,10467,13348,11136,5964,721
4,12825,
9406,5046,3558,9022,3810,6513,10834,5247,10658,5
827,10001,12403,5602,3890,6334,9103,3423,10542,5
923,108
89,6508,5693,9813,13378,11011,9774,4959,7712,124
55,3751,10600,6798,5547,3057,10779,10024,4855,59
60,1251
3,3514,7239,9063,12614,14342,3922,6803,5810,1035
1,2035,5797,8831,12594,7305,9672,13060,11292,647
9,6624,
10571,9890,5491,3003,5899,12445,9527,5104,11408,
6459,3787,6365,9080,14353,5719,10454,5578,9564,1
2944,94
37,12617,3534,6514,3978,7429,8671,12398,10549,67
57,5372,9614,12405,9460,4606,11302,7552,12500,39
37,9138,
11524,6566,5531,3052,6569,9924,9869,5748,3706,65
95,8942,7221,9994,12459,10428,6758,3869,6687,981
8,1332
6,10689,2037,7442,9585,13064,3766,9161,5075,1131
3,6379,3977,6556,10457,13352,10648,5588,3647,870
0,9805,
5049,3555,6487,9053,3824,6516,10849,6024,10836,5
925,7329,9638,12618,10049,3453,6919,3783,10791,5
485,108
90,6461,5834,13441,10469,9531,4859,3879,8949,354
1,10399,14346,5968,3058,10660,9574,5070,5549,125
14,4032,
7683,9162,12837,3503,10550,11333,6366,5739,1333
1,10781,1791,5809,12826,7243,12675,11528,6570,59
14,3005,
11013,9892,5311,10850,5498,12596,9435,12504,659
7,3913,6381,9111,10897,5725,10573,5616,9786,1270
4,7268,
9625,12559,11305,6703,7314,12567,10359,5926,303
1,5787,10018,12446,9696,5050,11338,7436,12625,37
58,6977,
9067,14354,5555,3006,6948,9827,12838,9451,5830,3
562,6856,9054,7226,10112,12960,10840,6978,6805,9
867,133
80,10579,9637,4975,7197,12406,3924,8950,5077,114
24,6952,3816,6923,10458,9341,5601,3769,7361,9140
,12620,
9551,12867,3986,6761,3708,6748,10608,5802,10892,
2038,7685,10008,12828,9788,5078,11271,6577,3548,
10470,1
3360,10631,6864,6020,9863,9904,5023,3451,6960,91
69,3940,7245,10553,14464,5929,10690,9577,12677,2
041,386
7,7320,9115,12461,3789,10782,11778,6980,5735,133
25,10574,9814,5543,12409,3564,9164,11316,6491,58
42,3035,
7041,10473,9626,5439,10795,5775,12841,7280,9503,
12487,11014,3980,6387,10415,5916,10363,5857,992

1,13072,
7441,12467,11395,6806,3511,8953,10898,5575,3060,5371,12516,9588,5091,7744,12626,3891,6598,9069,10852,5836,10581,6462,5497,9399,12600,9667,13824,3797,6819,7254,12992,11017,6762,5984,3047,9641,13442,10460,10004,4861,7225,12678,3886,9144,12462,7042,3325,6925,10554,9878,5052,5592,3695,7458,8687,12842,7364,9454,
12869,11345,6520,6572,13334,10664,1919,5957,7690,9836,12681,9811,4983,11308,6809,3973,6880,10635,9533,14348,5533,9621,12571,10017,5081,3546,6711,8895,3790,7251,10913,14369,5816,10823,7336,9563,12410,9830,5093,3561,7222,12736,3928,10595,11536,6984,5726,9759,9928,5909,12641,3765,6769,9127,11334,14401,5558,3064,
6382,10527,9877,5494,10423,2042,9170,7303,9817,12849,4001,10474,6503,11291,6601,10365,13384,10797,5741,
12491,3885,9075,11456,6543,3915,6931,8954,10900,5944,10856,5783,12351,9438,12628,3679,3517,6735,8695,10582,5343,10556,6822,5812,9650,12682,13337,11397,6578,3795,9117,10481,6821,6032,2815,9586,13569,11018,9461,5082,7434,12815,3952,7686,9070,12870,10803,3772,6493,9670,12844,5579,3572,7444,8927,12469,7246,12583,11314,6389,5747,3037,13347,10585,9991,5841,7332,12573,9870,5039,6602,3454,6810,10692,10052,5955,10637,
5604,7257,9635,12520,9829,12412,3802,6764,7697,14356,5930,10643,5550,7307,9673,12493,9565,4987,11352,7457,12470,3870,10447,6507,5937,9891,5094,9447,5691,12931,3883,6271,9185,7211,11780,14592,5374,10914,6335,9783,13444,10798,2039,4862,7269,10020,12850,3547,11025,6926,11340,6551,10672,9644,5561,12574,3992,9077,12873,11279,6580,3911,6770,9131,10597,5805,10427,2044,9186,7362,9592,12587,11402,6715,3938,6609,10476,
5860,10904,6825,5742,9936,12642,9848,11552,6390,3515,6851,9172,10864,14370,5833,3051,13333,10827,9881,
4607,3570,9118,3811,7490,8956,12499,11020,11320,6494,5581,9462,12689,13392,3743,7228,12473,3898,9133,11362,6743,5500,3038,6812,13349,10945,9820,5789,7692,12684,9559,12632,3053,3985,6934,10366,9997,5962,10482,6048,7309,9649,12874,7464,12933,11303,6604,3770,10805,13570,10638,5587,7267,10113,12881,9775,5084,7344,12823,3893,6393,10586,5753,10696,5848,9579,12528,9834,5903,3543,6826,9159,7808,14360,5495,10598,6717,
5940,9459,13338,10645,9676,5097,7315,12494,3703,10543,6555,6947,10809,9642,5047,5750,12383,3813,7260,9078,12615,11784,14372,4004,6933,6022,10484,2043,5803,9023,12852,7448,9875,13088,11398,6853,11337,6509,10835,9534,6584,5487,12690,10003,5098,11523,6772,3535,6833,9139,10429,14343,5564,10806,9897,9623,12644,3798,6518,3917,7368,8699,12595,10916,11409,6567,5932,9453,12589,10032,11294,7700,12705,3569,9081,11348,6610,5590,3007,6937,13448,10601,9842,5969,3944,9176,7274,9952,12501,10946,6394,3311,6515,9682,13354,10829,
5367,7318,9807,12856,3988,8943,11584,6625,3818,6718,10455,13408,11026,5790,7492,13120,9894,4989,3925,9134,3557,6557,10887,6019,10588,5557,7253,10050,12876,13323,3759,6747,3804,10659,5844,10646,6510,5811,9615,13825,10704,9652,5071,7689,12474,3894,10920,14465,5958,3059,11041,9575,4990,5911,12934,4008,7431,9188,12692,7199,14402,11309,6612,5593,13379,10602,2031,5749,12515,7714,9884,13184,11404,6799,7044,10830,9833,5606,10649,5858,12882,10006,12706,11526,6949,3832,6759,9163,14848,5938,10810,5471,9669,12590,7310,9465,12937,11361,6828,3918,7553,13059,11028,6854,5799,9704,12648,9925,5105,11792,7331,12827,3710,6573,9082,11346,14347,5562,3061,6938,9790,9566,5970,4033,6396,8701,7258,9998,12399,10837,6517,11315,6749,10114,
13340,10812,9841,7376,12619,3801,9141,5051,11426,6992,3975,6834,10459,13456,10551,5835,3576,9165,9589,12502,3897,6857,3930,6776,10948,5582,10838,6026,7460,9681,12597,9900,11529,6626,3814,10841,13350,10891,6950,5985,13572,10661,9819,5100,3559,9192,4002,7276,11032,14376,5754,11042,9882,12476,5917,3767,7227,9084,12737,3825,10851,11287,6571,5814,13361,10842,9466,6025,12505,7321,12696,11412,7048,5695,2943,10650,9630,5603,10471,5872,12897,7713,10009,12884,14404,3487,6558,10928,5501,10893,5831,9582,12839,7435,9656,12938,11368,6367,7270,12517,10488,5927,3054,5589,12447,10060,5106,11310,7698,12708,3926,6807,9142,14466,6080,10609,6836,5551,9343,12598,9923,13381,3939,6

979,7472,9698,12829,10430,6763,6616,10019,13576,10604,9789,5053,7281,13061,3987,9055,12898,11808,6599,3709,6940,10894,9643,5961,3550,7333,8951,12945,7745,10056,12621,11335,6953,4034,6858,13353,10899,1983,7392,9906,12407,9893,5079,11401,6865,3900,6981,10575,13386,10720,14355,5806,9587,9995,5054,3982,6860,9200,3771,7230,10555,14349,5610,10461,7446,9815,12888,9674,3820,7496,12627,3563,10610,11525,7008,5972,13472,10853,9468,5864,12506,3945,8702,11648,14384,5817,3062,6954,10662,9627,6034,10665,5756,12656,7317,9844,12940,3518,10691,11317,6750,10854,13319,10783,5596,12518,7338,12679,11538,7056,3791,9171,10475,5499,10652,5988,12601,9684,12738,7247,3979,6866,9145,10583,5915,10612,6840,5837,10120,12830,10021,13826,11425,6521,7568,12622,11015,6579,5612,3065,9581,13364,10557,9930,5083,7437,12521,4016,7704,8955,12843,14350,3929,6961,10064,13062,6028,3942,7273,9166,12463,7936,9645,12411,11779,6463,6765,13443,10462,9835,5559,7324,12946,9905,5108,11339,6956,3817,6628,10666,10010,14408,5939,7489,9407,12900,9594,12629,3565,6574,3826,7716,10693,14593,5845,10477,7282,9821,13065,9712,5095,11364,7443,12508,3989,10799,11410,6982,5934,10022,9883,5373,12602,3871,6811,9146,7363,11532,14357,5743,11073,6632,9651,13393,11044,2046,7255,9926,12712,3707,10952,6383,11322,6522,11074,13356,10901,6021,12683,4040,9071,11293,6603,3923,6766,9173,11048,5594,11019,5838,12961,7554,9697,12871,11457,3803,6771,10857,5609,10844,6581,5976,9898,12643,13584,11781,6524,3549,9174,10673,14468,5813,3066,13382,10960,10116,5112,7345,12575,3948,7752,9119,12471,11056,11341,6962,6049,10025,12522,13339,3773,7322,12413,7438,12845,11416,6605,5933,3039,13504,11076,9831,5963,7687,12948,9639,12904,6640,3981,6813,10587,9938,5727,11137,5565,7334,9535,12630,7461,9871,12604,11376,6823,7284,14371,13445,10483,5843,7223,10012,12529,9953,4863,11537,7365,13066,3887,6868,10902,14594,6000,9671,12851,9467,5820,3573,6985,9187,7449,11840,14362,5620,10694,6773,9932,13362,10558,9593,5085,7728,12633,4003,10915,6495,11350,6611,10858,10080,5502,12740,4036,7504,8957,12685,11321,14849,3932,6582,11138,5850,11021,2047,9148,7259,9688,12691,11554,6881,11460,6395,10616,13400,10668,6606,5918,12495,10053,11786,6586,3774,6585,9079,10905,14416,5931,10976,13828,9629,12962,3996,3828,7810,9177,12846,10807,11347,6613,5595,9912,13073,13388,11432,7693,12720,3566,9189,11318,6391,6040,3068,6827,13327,11080,9822,5959,7340,12645,7370,10005,12475,10865,3815,6986,9654,13450,10478,5986,7556,9590,12524,7271,12952,11399,6882,3953,10599,13600,10697,5563,7288,12912,9837,5099,7452,12875,3899,7043,10639,5618,11027,5859,7746,10040,13068,9879,13368,3941,6814,7462,14373,5791,10831,6927,5946,9439,13410,10918,9908,5086,7229,12993,3993,10674,14361,6993,10917,10128,5101,6033,12414,3805,7699,9178,12530,7337,11530,14358,11782,6964,13351,10589,2015,5818,12853,7720,9675,12686,11540,6872,11342,7072,10485,9843,14472,5941,12634,9937,12744,11428,6935,3578,6511,9135,10698,14596,5591,10906,10051,7520,9700,12646,11353,7045,4006,7377,12693,10860,11793,6774,5751,10026,12591,9646,11403,7465,12857,3519,6829,9083,11553,14600,5861,3055,6988,13832,10603,10033,6052,4048,9190,7348,9787,12532,10367,6777,11307,6855,9470,13446,10431,13385,7262,12883,3895,8958,11365,6397,3946,6835,11022,13571,10647,5583,7445,12477,9657,12854,3571,3990,6968,10676,5846,10866,5965,7319,9901,12964,13457,11458,7046,4009,10811,13342,10705,6830,5617,9956,13396,10921,9838,5055,7812,12649,3919,7366,10486,14374,5992,10947,9929,12994,5359,3819,7560,8703,12877,7277,14850,11586,6884,6036,13632,10590,9677,5866,12503,7491,13074,11324,6994,6519,10839,9596,5973,10908,5605,12935,7702,9885,12636,11788,14432,3577,6588,14403,5807,11030,5852,10058,12707,7450,10144,12694,11405,6614,11560,7311,12752,10700,6627,5942,12968,9683,5107,11363,7691,13089,3960,6559,9180,11440,14377,6056,10489,6629,9849,9944,13357,3806,7049,7346,9999,12650,10922,6939,11904,6617,9591,13452,10813,10036,7384,12878,4037,9193,12697,11411,6778,3994,6888,10651,13574,11043,5880,3574,9143,7760,9846,12858,113 56,6996,3954,7104,13409,11029,5966,7466,10118,13
076,9899,11544,7009,3931,6837,10949,13840,10605,
14480,5
758,13394,10680,9583,5109,3821,9194,4005,7275,10
868,14364,6081,10929,7938,9660,12885,13363,3901,
7494,12
860,4024,10614,11464,6941,5849,13474,10663,1002
8,6023,12507,7369,12599,11796,14405,5624,3063,10
706,968
6,5945,11033,5978,12996,7748,10065,12886,7715,14
378,11370,7050,10490,13577,10611,5862,12889,739
6,9463,1
2939,11414,6859,7285,12709,10721,5607,10814,605
0,13080,9886,13090,11588,7474,3799,6951,9085,148
52,5815,
10653,6618,5873,10115,12899,9653,13335,11349,67
80,7323,12890,10843,6838,6398,9940,13460,10606,9
907,499
1,7694,12698,4041,7809,9167,12519,11785,14385,35
51,6861,10054,5535,4010,7215,9086,12976,7459,100
07,1294
1,11527,6719,11295,7057,13416,10708,9689,7584,12
536,9845,5102,11810,6942,3829,6955,10895,13358,1
1140,14
410,5974,9702,9954,12657,3933,6523,3956,7352,110
45,14608,5987,10855,7497,10034,12478,9567,11406,
7335,12
652,4064,10924,11649,6841,6035,13856,10950,9895,
5757,12942,3902,9201,7708,11427,14496,5598,1066
9,6575,9
658,13383,11034,6082,7286,10066,12947,3580,1049
2,11354,6751,10613,13449,10845,5948,12623,7372,1
2768,11
472,6633,4020,9147,11088,6030,10930,5819,12603,7
468,9931,12509,15362,3822,7010,10953,5868,10872,
6867,56
11,9678,12658,10122,13573,11556,6630,7717,12901,
10722,14856,5993,3067,13696,11046,10081,5110,73
25,1271
0,3943,7378,9196,12713,14624,11372,7052,5566,985
0,12739,13365,4035,7937,12902,7705,10013,12831,1
1323,68
62,6957,13586,10667,9910,5839,7508,12523,10121,1
2700,11417,6620,4017,7000,11144,9791,14864,6027,
7261,96
99,12631,7555,9968,12660,11809,6983,3830,7473,14
528,13473,10654,7439,9597,13063,9927,5113,11531,
7290,12
605,3327,6869,10463,11366,14880,6064,10023,9685,
5977,3991,6842,9202,7616,11794,14406,5990,10903,
7058,10
176,13827,10932,9647,7393,12510,3947,11075,6896,
11568,7012,10859,13387,10712,5865,12714,4042,91
49,1137
7,14380,3711,6963,10695,5613,11036,5874,12741,74
93,10057,12525,11429,11841,6958,11049,13412,109
54,6583,
6037,12847,13458,11488,7073,4012,9175,10961,144
67,5919,11077,13580,9902,13121,7341,3833,7722,91
50,1309
2,10956,11326,6634,5755,9706,13000,13370,11542,7
283,13122,7824,12949,11592,6767,6088,3069,13341,
11104,1
0068,5971,7776,13096,7480,9960,13067,14417,3983,
6815,9913,13505,11050,5851,7342,10130,12905,750
6,9852,1
2892,11413,6883,7747,14386,13829,10846,5597,770
1,12721,9692,5114,11434,7557,13008,3934,7060,111
52,1440
9,5996,7447,9595,13104,10084,13389,4049,6607,738
0,11343,14351,5821,10962,6987,10011,13464,10936,
9933,50
87,7279,13124,3455,10617,14656,11664,6525,10675,
9708,6029,12635,3827,7816,9179,13185,7498,11533,
14469,1
1800,6641,13424,11057,2045,7730,10124,12531,113
69,7074,12032,6965,10559,13585,10861,14388,5935,
12950,9
655,11420,6870,4038,7105,9204,11052,14359,5621,1
0724,13888,7347,10035,12742,11585,4018,7326,126
06,1067
0,11812,7016,6051,9941,12963,13398,11378,7562,12
906,3927,9191,11539,14470,6084,3070,6636,13369,1
1078,10
030,5980,7394,13186,7476,9469,13069,10907,11459,
6775,9839,13602,10728,13508,7718,12664,7367,127
16,1135
1,6873,3950,10479,13834,10618,5822,7289,12953,10
117,13024,7749,3995,6844,10699,6044,10862,5876,7
940,969
0,12855,9934,13395,11650,6587,7451,14720,13480,1
0867,6885,5614,9705,13366,10677,10072,5116,7522,
13128,3
807,7706,10620,14412,14473,9909,12913,5863,3955,
7500,9208,12526,7349,11441,14418,11848,6989,134
47,1105
8,10145,6001,12647,7463,12745,11418,7064,11534,6
526,10701,10029,14392,5947,12687,7729,10059,130
75,1178
3,14363,3575,6966,10736,14433,5989,10909,9823,75
69,9661,12879,11430,6995,11557,7373,12966,10919,
11380,6
874,6041,12722,9939,11319,7753,12965,4044,6642,8
959,11461,14375,5853,10964,7024,13578,10096,138
30,3834,
7400,9916,12637,11081,6886,11545,6589,9716,1358
8,10869,13390,7536,12533,4007,9181,11824,6615,40
50,6779,
10591,13476,10707,5626,7292,12746,7840,9598,129
54,11600,3961,7076,13401,10678,6054,7724,9946,12
908,138
41,11355,6831,3997,10977,13451,10491,14595,5567,
13601,10702,10014,5103,7354,12651,4065,7564,106
82,1442
0,6096,10681,7756,10027,12415,13355,3582,7469,12
479,7944,14474,11906,7047,5943,13413,10709,9691,5994,13 070,7278,12695,11789,14481,6969,10487,10136,5619,10923,6038,12724,7379,10055,12914,7505,11436,14597,11 466,6644,14365,13506,11082,6057,12859,7721,10082,12753,11652,6990,11367,7814,12969,10978,14379,5967,12 534,9659,12995,11384,7339,3836,6889,9195,11548,14434,5867,11139,6970,9714,9955,13634,11842,6876,7408,12 638,10910,6590,11558,7106,9887,13372,11023,10042,7570,12887,3958,7764,9182,12956,11325,14851,4013,7080, 13836,11089,5625,4052,9197,7521,10129,13078,11795,6619,11433,6997,13453,11060,13608,7454,12748,9914,11 816,7011,3949,6781,10968,13411,11168,14424,6008,13488,10037,12537,4014,3823,7695,11031,14476,5854,1060 7,7374,9687,12970,13952,11616,7558,12861,4056,11141,11473,7051,6085,13459,10870,9847,6042,12699,7350,13 091,7811,11561,14366,5622,10925,9957,13404,11084,6002,7732,10148,13077,7477,14482,11444,6631,10873,135 92,10951,5979,12997,7952,12653,11358,6839,7585,12728,10493,5869,10931,6053,12916,7231,9679,12977,11541, 15364,3579,6890,14407,5949,11064,6972,6072,9942,12662,10061,13512,11415,6897,7754,12711,11142,14598,69 98,13844,10926,9713,5111,7381,12754,4019,7470,9151,13081,11908,14601,11462,7001,10088,13418,3998,7512,1 2538,7353,9455,12659,11656,6648,11373,6943,13462,10980,10132,7499,12769,9962,12862,11587,6399,3957,710 8,11090,13636,10615,14497,5847,10069,7386,9701,12701,11798,7053,4039,7817,14912,13397,10684,7703,9903,1 2891,9948,11546,7453,12654,4066,6863,10710,11407,14381,6089,13833,10723,10038,5599,3775,9203,7287,1178 7,14436,6058,10655,6621,10152,13575,10725,13343,7761,12756,3964,11145,11442,7059,11035,13858,10713,587 7,12943,7592,13188,11480,14976,3903,10874,5981,10984,6004,13093,7524,9976,12903,15361,11856,6782,11092, 13454,11200,6892,6112,12972,10062,13697,11562,7088,7872,12998,11105,14387,5950,10933,13475,9854,12717, 7475,4022,7371,9205,13082,14484,11371,7013,5628,10177,12540,13402,12034,7736,12661,7572,12893,11590,66 35,6843,13520,11037,9945,6068,7397,13136,7495,10119,12978,11465,14382,4043,6898,9720,14411,5870,7327,10 041,13001,7709,10074,12920,11844,7002,11811,7762,14602,13604,11146,7561,12770,9958,5115,11492,7620,1309 4,4068,6622,10955,11381,14609,5991,9703,10146,13420,4025,7112,7404,11570,14853,6083,11047,6527,9911,133 71,10714,9969,7356,12715,3835,10876,14440,11419,7054,10934,13465,10494,6065,13192,3962,9087,7945,11790, 14498,11905,6959,13857,10957,5878,7723,9631,12702,11311,11555,7120,10815,13579,11153,14389,5375,12511,1 3414,11680,7014,4053,9198,11038,14529,6039,11051,13842,7828,10070,12951,15368,3935,7777,12980,10619,11 448,7061,5995,10083,13123,13616,11593,7481,12907,7385,12760,11431,14488,6090,3071,13425,10937,10131,57 59,7750,12743,7968,9853,13084,14413,11804,6871,9694,13477,10671,13889,7294,13097,7586,10178,13002,1138 2,6637,7501,14500,13536,10847,6060,7395,13009,10044,13125,11468,7820,4011,7017,10729,15104,5881,7528,10 126,13004,9915,13374,11564,6845,7710,14604,13590,11106,7075,9964,13640,10963,9707,5117,7467,13152,4046, 7942,10726,14610,11813,14854,10089,6031,3831,7509,9206,13098,7617,11421,14390,11474,6900,13461,11148,9 662,7478,12894,12033,7004,11801,6643,10958,13482,11053,14419,5982,13200,9935,11604,14393,4072,6875,107 16,14857,6097,11096,13391,7792,10123,13010,11357,11651,7382,12984,11079,11569,6967,5503,12665,13712,11 535,7719,12723,4028,9209,11386,14448,5875,10965,7066,13581,10160,13848,7343,7818,10073,13105,10938,117 12,7018,10086,13417,11154,14080,7576,12607,7565,12909,11489,7062,3951,10992,13468,11108,6086,7780,1310 0,7398,9961,12772,15360,4021,6646,13633,11059,6066,7939,9709,12718,9970,13860,11589,7077,7510,14471,134 26,11054,14414,5975,13587,10679,10133,5118,7482,13126,4051,7826,11169,14625,14530,7731,10015,12955,135 07,3837,7355,12776,7632,11437,14421,11818,6887,13399,10730,9851,5998,12527,7502,12666,11379,14612,1192 0,6904,10863,10184,14858,6043,12747,7388,10067,12910,7725,11872,14394,11576,7025,14504,13698,10911,729 1,9947,12915,11438,6638,11602,7523,12725,10979,11843,14475,5855,12668,9693,11797,7416,4045,6846,9210,11 653,14435,6003,11156,7065,13489,10092,13896,115

43,7768,13106,10703,6645,11476,7020,9917,13466,11083,13582,7559,12749,4080,9183,11375,14422,4026,6991,13831,10621,5623,8000,12784,7588,10125,12957,11912,11594,7136,13478,10737,13605,7841,12967,13428,11826,6591,3965,11170,13367,11061,14396,6092,13509,10031,13012,7751,4058,7580,10966,14616,5882,11201,7513,9717,13129,13593,11443,7401,12917,7848,14425,11422,6877,6055,13872,11112,10147,6098,12639,7941,12755,7813,11658,14626,14865,10180,13648,10732,6009,7484,10076,12726,7375,11490,14860,11572,6971,14532,13403,10871,6045,13025,7734,12539,11814,7078,11463,7778,12750,10969,14477,6113,12730,7618,9918,12729,11385,15376,3567,7026,11845,14437,5630,10940,7081,10140,9972,13954,12036,7107,7563,12757,10683,14483,11547,6891,13837,10981,9710,7409,12535,4067,7263,9212,12971,11618,14512,11802,6649,13484,13514,4054,7525,9959,13130,11596,6999,11445,7068,13700,11085,13415,7954,13026,10097,11559,6878,3999,6973,11160,13432,10622,14478,5884,13596,7707,10043,13187,11825,3959,7357,14866,13890,11062,7755,10085,12958,13606,11665,7507,13071,4069,11091,11469,14657,6006,13373,10970,10137,6061,7574,13137,7402,11849,14367,6100,10738,9949,13843,11120,13481,7832,13108,7530,14536,11496,7109,10982,13864,10685,5997,13016,7758,13216,11632,14426,7874,10711,6062,10875,5871,13079,7383,9722,12655,11388,15392,11936,7082,14881,13664,11172,7028,6104,13189,10150,13521,11820,6650,7471,12918,10927,14628,14658,13609,9663,12973,7733,4057,7948,9199,13132,11450,14868,11660,6893,10192,13492,11852,7514,12921,7784,12999,11565,7089,12040,7110,13406,11143,10039,7600,12541,7825,10090,12979,11374,14599,3838,6899,13589,11065,14485,5627,9715,7410,10134,13112,11475,7003,11601,7571,14438,13463,10740,7737,13190,10153,11817,7532,12974,4074,7084,11086,11910,14441,6067,13956,10063,13510,4023,7358,11435,14640,6046,10985,6974,9963,13704,11066,13421,7953,13028,4060,10972,11504,7055,10686,13635,11202,6005,13138,7765,12663,7726,11666,14632,11860,13846,11176,6087,7976,9721,12732,15366,11617,7015,10715,13594,11093,14499,6114,12758,13455,11550,6783,7624,12771,11107,14428,5823,10877,13835,7842,10104,12703,15369,4015,7479,12773,14383,11791,7032,6012,9950,13193,13490,11470,7516,13083,7389,12761,11654,14603,6623,13528,11147,10181,5951,7566,12922,7412,10138,13032,11446,14721,11907,7090,9718,14882,13904,7876,13140,7821,10098,13248,11828,6894,11573,7946,14660,13610,10727,7770,13153,10075,12981,12048,7537,3963,7113,10935,11681,14544,6070,9965,10149,13419,11327,6652,7757,14722,14082,10986,7005,10045,13638,11068,10168,7590,13085,4073,8001,10993,14486,11850,14489,13513,11094,6091,4070,9207,7483,11477,14501,11566,6901,13892,11097,13859,7526,13194,11608,11449,7114,10744,13540,11039,14442,6116,13003,13429,11595,14391,4029,10495,14664,6073,11204,13618,7844,9943,13095,15424,11482,7387,12762,11149,11913,7063,5883,12924,13467,11799,7738,12982,7577,12542,11549,14872,6010,10959,13838,10185,13953,7970,7648,9695,13005,14913,11383,7019,10154,13359,10717,13603,7779,12863,7403,13201,11857,7006,8064,14884,13728,11155,6101,7819,13086,7589,9973,13099,11688,15370,3966,6902,14449,5983,7293,10077,12667,10100,13496,11620,7092,7503,14490,13641,10878,14415,13479,10988,10208,5119,7960,12985,4081,7740,11184,14605,11968,14444,10046,13852,4047,7815,12719,7856,11571,14914,11467,7121,13430,11109,9724,7529,12895,11832,14560,11668,7067,10731,13516,10939,14502,6059,12777,10164,7766,11493,14855,11591,7116,14888,13612,10994,7578,9966,13154,11423,11805,7455,13011,11098,11858,14531,6094,12774,13861,11657,7873,4076,9211,11716,14606,5879,10718,6905,13469,10087,13522,15377,7540,13196,11208,11500,7021,10179,14081,10623,13849,7351,13006,7619,13101,11452,14977,3581,13652,11150,6120,7593,12764,7956,10161,13144,15372,12041,7096,13405,11055,13699,7830,13127,9974,13617,11819,6639,7406,14859,13583,11216,14611,6076,13434,9471,13013,7788,4059,7763,11110,14916,14627,7485,10135,12986,13760,11924,7573,13202,7969,14395,11873,6847,13537,11157,10091,5999,13040,7515,13156,7782,11577,14505,11481,14896,10186,14 450,6069,7711,9855,13107,7880,11846,14613,12064,
7079,14492,13637,10967,7829,13102,11390,7122,11
682,776
9,12727,10733,11597,14423,6099,13217,10156,1149
1,15488,4030,7027,11916,14533,5885,11113,6906,13
485,997
7,13866,11624,7390,12778,10941,14452,11806,6647,
13427,11171,13968,7602,12911,4082,9213,11563,14
506,120
38,7069,13920,13624,7538,7413,10127,12959,11605,
11713,7022,13486,10996,13650,7622,13027,13891,1
1574,68
79,4027,11100,13845,10739,14397,6093,13701,7943,
10078,13204,15378,4071,7822,14867,13591,10971,8
004,101
93,12751,13524,11888,7587,13131,7781,14861,1147
8,14978,6128,13423,11063,9599,6074,7625,12669,75
17,1181
5,14617,14614,9971,13960,11162,13642,7843,12785,
7399,11439,14862,11914,7137,14513,13874,11114,6
013,1321
8,7735,13109,11672,14629,11661,7972,11158,14724,
6106,13014,7596,10182,13249,11876,15393,11494,7
029,144
27,13491,10742,7083,10162,13470,12035,7138,7544,
13160,11173,14920,11606,15105,13706,10071,7888,
4061,78
00,9214,12780,11578,14534,11922,7124,13538,1362
0,11827,7833,12919,11451,7070,11728,6908,13862,1
0983,13
511,7414,13017,10094,11598,14508,4084,7085,1343
3,11000,14456,5615,13893,7772,10139,12988,11484,
11821,7
511,14537,14084,11121,7949,12731,13595,11387,76
01,13029,4055,10734,11619,14672,6115,13666,9951,
13850,8
065,7727,11512,14398,6102,10942,10099,13644,111
61,13493,7531,13133,7786,14618,11864,7111,10741,
13607,11
116,6047,13208,7411,12670,7628,11655,14479,1536
5,13873,11087,6007,7594,9719,13110,12096,15380,1
1684,70
30,14439,13713,11232,14514,6117,13139,13517,119
37,6975,7827,13018,10687,14630,14429,13897,7486,
10188,1
2786,15394,4078,7955,13168,11847,14980,11676,70
91,9978,13544,11609,7849,13030,7575,12733,11497,
14538,1
1944,6651,13680,10973,10151,7405,12759,7984,101
94,12923,12037,14928,11909,7033,13436,14659,139
84,7794,
10105,13220,11580,7128,11471,7904,14728,13868,1
1067,7634,12975,10141,11830,7759,4062,6895,1117
4,11874,1
4633,6105,13498,10209,13708,11714,7846,15106,13
900,11122,7086,9726,13613,11177,14088,8002,1319
1,4088,1
1203,11659,14443,13422,10987,5886,7567,13113,76
04,11505,14516,11359,13523,10745,13649,7527,127
88,15616,
11621,7140,11095,13865,11164,14487,6122,13134,1
3958,12050,14545,7836,10974,14620,6071,11069,13
483,778
5,9980,13033,15363,11803,7958,13114,14984,11453,
7115,6108,13020,13552,11851,7621,12734,7417,132
50,1160
3,14430,14540,13714,10102,13908,7656,7877,10157,
13224,11670,14634,11498,7034,10196,14736,13665,
7742,12
763,7518,13141,11928,6653,11626,7950,14944,1359
8,11205,8066,13155,7793,10093,12925,11854,15425,
3583,70
93,11970,14688,6063,10158,9967,13839,11479,7117,
7541,14661,13518,11178,14869,13702,11124,10200,
7633,131
95,4075,7852,10746,14491,11567,14546,13494,1395
5,4077,7771,11829,14641,12044,7144,13876,10989,1
3621,78
34,12775,11610,11880,7036,11185,14096,11206,148
83,6011,12983,13729,7418,11696,14636,11921,1444
5,13375,1
0995,7582,9723,13034,15384,11506,7961,13116,110
99,11667,14520,6121,13041,13898,11833,7534,7608,
13142,1
1628,14870,6118,11180,13525,10163,13614,15396,8
012,13145,14873,11454,7094,10142,13656,11070,13
497,7295,
12792,7875,13087,12049,14451,7650,13643,11151,6
077,7971,12543,7741,10101,13252,11861,15426,118
22,7007,
14503,13530,7595,13197,10183,13961,12072,6903,8
008,14561,13847,11111,14662,13597,10210,13007,7
858,4083,
7845,10879,14642,11720,15108,9919,13431,11938,7
539,12765,7947,14493,11575,7152,13905,11128,101
08,7767,
13203,7626,11612,14992,11485,14665,13736,10719,
14446,6014,10047,7420,11662,14453,11508,6654,14
548,1366
8,11186,7579,12926,11972,11917,7796,13036,10990,
12042,14507,6129,13232,14016,11866,15374,4085,1
1633,15
112,6095,11209,7123,13619,10166,13515,15400,763
6,13157,10748,11853,7097,13880,11101,13716,8072,
12779,7
973,12987,11686,14666,12097,13541,13639,7533,78
82,10187,13042,15489,11579,6907,13471,10997,138
53,8016,
13146,13906,11622,7118,7597,14562,13705,11210,1
4885,6124,13764,7787,10212,12766,15379,3839,785
7,14874,
14723,7962,10169,13256,13548,11940,7359,12671,7
546,14644,11483,14552,13500,11159,9979,5629,777
3,13198,
7664,11834,14752,11673,14607,10106,14615,14089,
7974,13103,7835,12066,14494,11744,7098,14673,13

867,11115,7603,13264,11875,14886,11499,7878,11102,12160,15008,6107,13158,10197,11915,15428,11685,7023,14454,13972,10998,7125,10079,13921,11389,7649,13205,11188,14668,11599,14915,13625,13529,7850,4086,9215,12056,14876,11836,7126,13894,14112,15408,8068,13015,11911,11952,7071,13438,11217,13730,7977,12781,13645,11625,14725,4089,13539,11163,14509,6078,13964,7783,10155,13161,15373,11862,7591,14457,13672,11212,7890,12989,13854,11674,7487,13219,7823,14889,11551,14535,6130,13611,10190,14086,7964,7905,11969,15120,14515,9975,13653,11001,13761,7623,13044,7419,14564,11636,7139,14674,13622,11117,6075,13148,7884,12787,7545,11447,14648,11715,15872,15040,6119,8032,10216,13019,11689,15490,12052,6909,14726,13936,11192,14510,13526,11926,7100,7640,13111,10735,14890,11502,14917,13863,10172,15382,3967,8005,13210,11884,14729,11859,7031,13487,13962,11581,7581,13162,11669,14619,12065,7129,13720,10943,13709,7864,13206,10095,11611,14458,11878,7141,13924,14784,13542,7774,10165,12790,11807,11976,7957,14689,14083,11175,7606,13221,13654,11925,7542,4090,11218,11865,14897,6109,13626,10195,13970,15432,7789,14539,13875,11123,9981,13499,11002,13776,7992,13031,7831,14399,11486,14676,13646,10743,6132,7391,13048,7860,11698,14730,15385,13532,11165,13869,8080,13169,11634,15617,11509,7130,14863,13435,11118,14918,6103,12782,13667,11718,14892,7627,10975,14517,14631,13560,7795,10189,12990,15395,12039,7889,13209,14621,11918,7087,13912,12100,8003,12789,7652,13164,11683,14568,11877,14460,13703,10224,7978,7598,10170,13135,11721,14541,11613,7035,14144,14518,13732,7985,13280,11939,7142,11495,7739,14979,13985,11233,7422,12735,10109,11831,15492,4087,6910,12068,14898,6126,13895,10202,13724,11692,7609,14622,13657,11125,14921,13545,11179,13992,7853,13021,4092,11234,11640,14635,14085,13957,7908,7790,11984,14690,11896,13628,11220,13519,7881,13115,15381,11929,6655,11166,13878,11004,14547,6110,13222,13922,7629,11510,14737,15440,14521,13762,11181,7548,9711,13170,15397,11868,7837,13225,14732,11607,14680,6136,13251,13707,12045,8010,8096,13035,11697,14922,14981,13553,10211,13407,15618,7635,12793,12161,14929,11823,7132,10198,14871,13669,7801,13143,7896,13212,11627,14576,11882,7951,14098,11207,7543,13022,7988,10143,13117,11507,15386,11724,7145,14542,13851,10103,13501,11690,7095,7798,14431,13899,11126,14663,13651,10213,8070,4091,7851,11071,14900,11923,15136,13718,13546,11582,7535,14738,12051,7146,13976,11187,13674,7612,13253,11945,11671,14692,13902,10747,14643,5631,14018,7980,11501,14637,12080,14753,13527,11129,7638,13226,15496,11890,8017,13172,11224,12000,14549,6123,12794,13615,11730,15402,7415,11855,14904,6125,10991,13877,10201,14092,15456,7838,13037,15168,11942,7037,13658,11182,13928,8067,13233,7605,13254,12098,14924,15371,13744,13969,7892,7859,9982,13043,11663,15873,11700,7119,14522,13554,8006,13147,13715,11623,7038,7959,14982,13881,11236,14740,13676,7641,10218,13228,15427,4079,7797,14563,11932,15232,10167,13502,11881,7654,13118,7906,14930,12054,14754,14097,11211,10204,7986,13199,7519,11717,14638,11513,14985,13909,15107,13870,7847,11752,14696,11973,7153,14875,14120,11130,7610,13159,11838,11614,8018,10749,12046,14447,6131,12927,13768,12162,15388,11889,14667,13986,11189,7099,10159,13623,15504,7883,13176,11213,11637,14550,13660,13533,7630,8074,12767,11729,14645,11948,13710,13556,15398,8033,13234,15620,11867,7148,14020,11240,13965,7802,13038,14090,11930,14524,7965,13914,11132,14785,6133,13681,7862,10107,13257,15409,11514,8073,14553,14744,7743,12796,13901,11678,7651,13149,7920,14945,12057,14932,13734,10217,14145,7549,7879,11630,14887,11704,14986,10214,14565,13627,7975,13045,7637,14495,12108,7154,14756,13670,11190,8128,13258,7599,11391,14646,11971,15429,11746,14877,5887,10173,12067,15624,11837,7101,15109,13988,11103,14946,13531,11691,8009,13207,10999,14993,12104,14669,13882,13721,15401,4031,11954,14455,11941,7127,14114,13792,15434,7854,13163,11635,12043,7102,13923,11248,13547,7658,13150,14208,11863,14936,11722,13963,14675,13733,802

0,10110,13046,15520,11516,7912,14554,13437,1075 0,7865,1 3236,13647,11675,8082,7804,14704,11892,14988,61 34,14104,10225,13884,15367,7644,14566,14727,101 91,13959, 11219,14000,7547,13265,8036,14649,11732,14786,1 3673,11193,6137,7963,13211,7885,12168,14878,120 69,1587 4,14670,13910,7660,13260,11629,15412,11978,7131, 14569,13722,11003,14891,13599,12112,15110,8076, 11214,1 4511,11693,14459,14017,10220,15491,11883,7607,1 3049,14994,11953,7156,13684,12058,7987,13165,11 455,1494 8,11642,14677,13495,13763,7893,9725,11869,15113, 11760,7143,13737,14556,14100,7982,13240,12070,1 1931,74 21,14650,13974,11194,7791,12783,13550,11699,154 41,4094,11974,14760,6015,13932,10203,13907,1540 4,8069,1 4731,13629,11119,13717,11221,14113,7642,12991,7 886,15009,11745,14919,13659,13926,7657,8024,119 46,14691, 15632,13855,11222,14024,7861,13223,15430,12164, 7160,14623,13973,11167,14519,6138,13266,13913,8 097,1207 3,14570,15387,14461,14893,7981,10174,13171,1555 2,11879,8011,13050,14996,11687,14952,13534,1198 6,7775,7 613,12791,11583,14678,11919,14652,13746,10226,1 5493,7891,13213,12060,14577,12001,6911,13682,15 114,1355 7,8048,13166,11719,14899,11515,7868,13766,11235, 7668,13023,10171,11980,15410,11641,7133,14681,1 4087,10 215,13966,12128,7550,14788,14148,11005,14733,13 731,13925,7898,4095,11196,11736,14739,13769,136 61,15448, 7966,14543,12101,13987,11127,13543,7979,13281,1 5876,11677,15010,13879,11225,14894,6135,14116,7 643,119 60,15121,15436,14768,13740,11237,8088,13173,153 75,11870,8007,13227,14693,12053,14523,6140,1328 2,13688, 11702,15498,8034,11638,14572,15000,14032,10205, 13944,15648,7611,13268,14960,11885,7147,14923,1 3977,766 6,13214,7907,13052,12088,15116,11927,15416,1355 8,7839,7994,10228,13229,11487,15458,11956,7134,1 5041,13 916,13655,12176,7149,8081,14462,14093,11226,145 78,13745,10199,15399,4063,7866,14901,11723,1473 4,14209, 13871,11891,7989,14682,11985,14792,13675,11183, 13930,7639,13255,12099,11748,14694,13555,14741, 13772,77 99,12074,14639,11694,14905,13738,11131,7909,131 74,15880,12081,8100,11238,11835,14580,6139,1311 9,13971, 11518,15494,15433,14931,13630,11006,10222,14099 ,15619,7631,13235,14525,11705,14902,13993,13719, 7894,80 13,12795,11949,15012,15505,13549,14128,15390,76 65,13177,12004,15444,11886,7103,14697,13938,804 0,13272, 14048,11977,15042,7407,13778,10751,14925,13903, 8084,10206,13039,15680,11725,7914,14551,15122,1 3990,116 44,8021,13230,7653,14983,11933,14684,14146,1023 2,7855,7900,12106,14755,12192,14742,13711,14800, 13748,7 990,15016,11731,7155,15137,13671,11228,8104,132 84,11897,11992,15405,12047,14698,6127,13980,116 39,15500, 12084,14926,13929,11241,14745,14102,15622,7928, 13259,11191,11894,14906,13765,13561,15457,8014, 12166,1 5124,11947,13800,14021,15888,7806,13178,15442,1 1631,7157,13886,11242,13662,8129,12797,14094,11 708,1493 3,15411,14210,14908,13937,7897,9727,13237,15522, 12076,8071,14555,14647,7672,13261,13685,11734,7 993,802 6,15044,12113,14934,13777,10219,13996,15625,791 0,14937,11511,14987,10221,14757,13915,7655,1328 8,8098,1 5128,11934,15138,13978,11133,7863,13180,7921,12 163,14947,11701,15383,14938,13562,11988,15508,1 1955,703 9,14746,13726,11215,14567,14105,12102,7583,1113 4,15024,12055,14989,13678,13752,15464,11737,145 84,11893, 7150,14156,15406,8022,13238,11750,12002,14705,1 3439,14019,8035,13794,12082,14526,11615,14115,1 4700,13 885,8083,13151,15904,11943,7805,14990,13739,112 49,7646,13047,14152,11706,15431,8130,12114,1499 5,6079,1 4002,10227,13989,15497,7996,14671,14816,13683,1 1195,14091,8078,13296,7867,14651,11979,14557,13 911,1377 0,7916,7659,11726,14706,12170,15621,14949,13564, 8041,12798,15744,12129,7158,14758,13723,11244,1 4761,13 940,7614,11898,14787,15413,14950,12061,14879,10 229,15634,11958,7887,13267,14571,12169,14748,13 780,1183 9,8075,13241,11747,14679,12016,14708,14216,1411 7,15521,11645,15111,11975,7161,13677,14653,1402 6,8112,13 051,12071,11733,8025,14160,11250,8038,13262,137 41,12224,15875,11695,14558,13931,9983,14001,154 35,7913, 14762,14106,11197,13503,13690,7661,7922,14789,1 2105,14573,13917,13808,15460,8085,14895,15506,1 4118,112

23,13979,7967,13242,15628,11950,15169,13747,11198,15140,6142,14022,7803,11754,15048,15418,15170,14997, 8136,13167,15389,12116,8019,13269,15144,12008,15115,13793,11961,15553,7899,12178,14953,11900,14940,13994,10230,15877,7645,13270,14769,11740,7162,15056,14212,8044,13215,11643,15152,12132,15437,14121,7869,10233,12059,15512,11981,7135,15172,13927,13735,11756,8077,14683,14034,11227,15233,13631,13967,15472,4093,12172,14579,14108,14049,15633,7983,14998,11703,13767,11252,13563,7669,13283,15936,12083,14790,14028, 14654,13689,8099,11989,15011,15446,14954,14176, 11239,8132,13053,15417,12078,8028,15234,11517,15117,6143,13244,13784,11887,15650,15556,14712,14764,10111,14149,15882,7870,13175,15001,12165,15072,13725,8092, 7924,13273,11738,14903,11982,15443,14008,15528, 7662,13285,11753,15414,12120,7164,15176,13918,14101,11957,14961,7911,13750,11256,14574,13686,10234,15495,12193,8049,14695,14793,13933,12077,7995,14735,12107, 15123,14136,13975,8037,11871,11709,14927,13535, 15014,14004,8089,14770,11987,15013,14224,11007, 7901,13274,15626,12144,15878,11964,14685,6111,13771,11764,15636,15438,14581,13939,11229,14033,15524,7674,13231, 14794,11646,15002,14147,13796,15449,8102,11994, 14956,15889,14122,13742,15499,7615,13179,15649, 12062,7151,14699,14129,8144,13286,13883,12075,14463,15403,13566,14527,7991,10231,13054,15461,11739,8042,15118, 14743,13753,12184,7667,8086,14772,12103,14962,13997,10236,15554,8105,14907,12130,14801,14052,15017,13934,8015,14582,11707,15043,14025,11243,7915,12799,11762,12003,15682,14686,13773,11935,15420,12090,14935,13692,11230,15004,13981,15884,7673,11245,12177,15126,14154,14240,15501,15656,14796,11962,13779,15459, 8056,13276,15536,12085,14585,13945,14040,7902,14095,11735,15018,16000,13687,14909,14132,8133,13289,15507,11895,8090,14747,15139,7670,13239,13942,12005,15452,8050,12196,15125,14214,10235,13995,15640,8027, 15045,14701,14776,13679,7917,13290,8101,14964,11727,15025,13756,7997,8120,11990,14710,12109,15560,14759,14124,15892,11761,7159,14802,13782,11199,15129,14161,12136,15466,14586,11503,14707,13559,15510,12180, 14817,12010,14910,13982,15684,7895,13181,12117, 11749,14749,14211,13749,15445,11951,14939,11996,14036, 14702,14003,8137,13263,15881,12086,7647,14150,11251,8106,13182,14103,12200,15623,15391,14804,13785,10223,13941,15906,7925,14991,15236,13798,14050,8029,8052,15141,12024,14951,14130,13663,15502,8160, 15020,12110,15745,15046,13991,7998,13297,15523,11902,14765,13754,11253,15130,14162,7676,12225,14588,15450,14709,14941,15568,11993,8116,13243,15184,12167,15026,14027,11768,7918,12089,15049,12122,14968,13774,14218, 15652,14818,12006,7163,15142,14177,8039,13292,11751,12194,15468,13946,8131,14109,11959,15419,12017,14763,14006,14217,15513,8113,15240,13887,11135,13795,14064,15905,7926,11679,14750,13693,14023,15627,7423, 14559,15462,14119,11246,13781,8087,13298,15890, 12118,14999,14272,15028,13743,8043,12131,15171, 15664,14955,14808,8138,13245,15473,12179,7807,14791,11901,15132,14153,11742,15525,15937,15145,12226,15050,10175,15584,8108,13271,15057,12092,15173,13998,7929,13246,12174,15052,11963,15422,13802,15638,12012,15688, 11755,7165,15200,14164,14056,12137,8079,14009,11254,15146,14226,13948,15509,11710,14942,13788, 15530,8030,15248,11983,13691,14180,8145,15439,12171,15058,14107,15032,14029,7551,14713,15760,14771,13804,11257,7923,13275,15629,12208,15896,12121,15153,6141, 14220,12134,15465,16128,14655,14957,13751,15516,8134,13300,15148,12009,14820,14131,15681,8114,11757,14766,12018,15908,14037,15474,8023,13287,15635,12181,7166,15174,14126,13565,12063,15003,15555,13935,14824,10238,15447,11899,8046,14575,14714,14213,12232,8091, 14795,12115,14958,13786,14030,15746,11995,14963,13801,14773,14168,7903,14716,11741,14005,11258, 8051,13304,15537,12140,15944,15154,14241,11965,15514,15630,14797,14125,11231,14155,15879,7671,14832,12173,15005,13919,13757,15526,15653,15015,15476,14035,15415,8140,13055,15557,12079,15060,14192,7930,14012,11765, 15177,15641,13812,14965,8103,13277,15920,12195, 8146,14687,14803,13694,12228,15696,8057,12124,1

4774,14042,10239,15451,8093,15073,14587,14798,14110,8161,14778,11966,14777,14123,7678,12188,12020,16002,14805,13787,15885,11758,14583,14232,11260,15019,14151,15532,15562,12007,15178,14178,15748,15463,15074,12145,13755,15480,7932,13291,15644,12091,15235,13810,14051,15938,12133,15006,15654,13983,15119,14138,8054,13278,15421,12185,8109,15185,8148,13293,14225,11997,15891,15529,15156,10207,14010,15912,8045,15064,15264,14133,8110,7919,15127,11770,14703,13783,15712,8152,15237,12198,15569,14966,13943,15657,11711,15021,14053,11247,15180,14244,12240,15540,14969,15047,15454,12087,14589,12138,15027,13775,15637,7675,11763,12182,15160,14038,14157,15511,15238,12201,15022,13809,8115,13247,16004,12111,15558,14184,8094,13551,12011,15752,15469,15076,14228,14058,15683,8053,15186,14711,14165,13797,15894,8135,11769,14780,13999,14044,15642,8162,14806,15503,14819,14134,7871,13299,15883,12152,14751,14248,14821,8060,11998,15241,15538,15131,14809,15576,12229,7999,14970,12186,15080,14072,11766,15952,15188,12146,15296,14158,15658,15201,12123,15029,13950,8118,13301,12013,12197,15467,14273,16130,12093,15686,12216,15133,14041,14215,15561,8139,13816,11255,14137,14170,15940,15907,15242,14054,15588,8164,15051,15477,13799,14242,8121,15666,11991,15143,14007,14810,14065,7931,14972,15515,15030,14590,8058,13183,15886,12233,16001,11743,15053,13727,12202,15407,15651,14911,15249,15776,8149,13294,15134,12021,15147,14166,8031,12125,14715,12148,15544,14179,15689,15527,12256,7167,15033,14227,13949,12094,15900,13790,14767,14274,15478,11772,14943,14140,15564,8107,14825,12212,14222,14011,15660,12014,15202,14060,15059,13803,8142,14822,15909,14185,11259,7927,13302,15517,12135,15570,15244,13758,12227,16129,15897,15054,15149,14031,15700,8168,14812,12209,15192,14219,15453,15747,15175,12022,15665,15631,8124,13305,15482,11519,15061,14256,14169,12183,15034,15808,14182,15250,15585,12139,8047,15088,15204,14057,12234,8117,11903,15155,13805,14066,15685,15150,14775,14229,8147,15265,12204,14111,7933,15533,12025,15914,14826,13947,15475,16016,14959,14280,11261,14163,15968,15672,12175,15007,14043,15534,15698,15075,15939,13789,15893,8141,13306,15749,12126,15252,14188,15639,12241,14799,15572,14013,15179,8176,13279,15471,11647,8122,14717,14221,12019,16008,15690,14833,10237,15922,8061,15266,15157,14127,8154,15062,12230,15297,13813,15539,12210,15518,15208,14243,15754,12119,14276,11262,14828,14172,15586,15668,14967,15910,15559,15065,12142,14014,15481,7663,15941,12187,15036,14236,14068,16132,14779,15643,15077,13806,8163,13308,15714,11999,15898,8150,14055,12147,15692,15541,15181,14193,15655,8095,15256,14718,14139,15921,8055,11767,15158,14181,15761,8165,15187,15565,15066,14233,15945,12236,14834,14045,15216,12026,15592,15078,14781,15728,12199,14807,12242,14971,13818,15484,16032,12153,15268,14246,15916,15023,12189,13759,8153,13295,15546,12257,15756,14288,15948,11774,15661,16136,15239,14135,14186,15470,7934,15161,13811,14230,15571,15697,14836,14249,15913,8170,15182,16006,14159,8119,15531,12028,15081,14059,15162,8156,15068,15600,14782,15298,15762,12150,15956,12205,15272,13817,12244,15713,14811,15189,15646,15203,12141,14973,14200,8111,12206,12015,15887,14046,15566,15750,12248,15243,14277,14234,15542,16003,13814,14194,15924,15669,14823,14171,16144,8059,15031,15777,14061,14245,15423,11771,15082,14141,15164,14264,8169,15089,15946,15190,8166,13303,15573,12211,15662,15193,12190,15704,15545,14840,15135,15691,8125,14591,12149,15300,14039,15578,15245,12231,16009,15895,15645,12258,15055,14281,13791,11967,15479,14250,14813,15953,12156,15251,14069,15784,8062,12095,14173,14196,15716,14974,15084,14304,8177,15280,16064,14142,8143,15667,12214,15563,15205,13820,15928,15764,14827,15035,14260,15589,15687,12235,15090,14062,15519,15901,15194,15954,15753,8172,13307,15812,12260,14814,14183,12217,15304,15596,14275,14719,15548,12027,7677,15246,14257,12154,16137,15151,14070,15915,15312,13567,8155,15206,12245,14231,16020,12127,15969,15253,14187,15673,15577,14282,11263,13951,15942,16160,15063,15486,15778,14829,15693,14252,15587,8126,16012,12203,15209,14073,15720,15037,15902,15267,8178,13309,15659,12238,16134,14223,12023,15701,15809,15092,15670,8123,15196,14835,14174,8167,12264,15067,14289,15984,15574,15159,13695,15911,12220,14067,15258,15535,16010,15210,15768,15757,15254,12143,14278,15972,15590,12213,14838,14258,16131,15269,15702,14167,8157,13310,15674,12243,16018,15923,12029,15547,15824,15079,14190,15694,8180,15096,14235,15580,15917,15217,15483,8151,14830,15715,14047,15608,12237,15038,14195,15257,15960,14837,15212,15751,12272,12218,15183,13815,16192,15780,15328,16033,14783,12157,14284,8174,15943,12250,15772,14074,15705,15593,16040,15069,14247,14290,16133,16005,1420 1, 15676,15567,15163,14237,15926,8158,15270,15970,14305,15810,11759,15218,13822,15273,8184,15299,15755,15083,15601,12259,15455,14841,12246,15717,15191,15260,16146,15070,12191,15165,14076,15899,12151,15549,15947,15699,12261,14198,14253,15766,15594,14292,16024,15722,15301,14189,15950,7679,16066,14254,14063,15575,15274,15220,14296,8171,14842,15663,8173,15925,12249,16140,15085,15706,15976,15281,15302,15792,16017,12030,15091,13819,15602,15195,15763,15929,15724,12266,15276,14259,12215,15550,14238,15166,16145,12252,15247,14197,15957,15918,14279,16168,15207,14306,8179,14975,15816,14015,16034,12207,15671,15224,14204,15708,15581,14815,14143,15758,15604,15282,16068,16013,15086,16138,15962,8181,15729,12155,15305,14262,14844,15949,15197,15782,12265,16193,14283,12262,15675,15093,15718,15306,14308,7935,12221,14265,16036,15579,15255,14075,15930,15769,14202,16162,15840,15211,15971,15595,15198,16256,14293,16011,15781,12158,15094,14175,15485,15284,15695,8182,13311,16152,12273,15932,12239,16007,16048,15313,15721,8185,15259,14251,15958,15308,15770,15647,14286,16065,12268,14071,15097,15732,15213,15543,15811,11773,14312,15785,16148,15288,16022,14831,15598,14268,8063,15980,12251,15955,15677,15765,16161,15039,14191,15707,15974,14261,15903,16072,15271,16021,8186,15314,15961,14291,12222,15219,14077,15098,15582,14839,15794,12274,15261,15730,15605,15214,15814,15071,12219,14285,16135,12263,16014,16196,15779,15973,14320,14266,15817,15709,16035,15591,15329,14205,15927,8183,16164,14298,15788,15221,15275,8188,15330,15736,16080,12253,15992,15316,16025,15262,15100,15606,12276,15277,13807,15964,15703,16141,15793,12247,14307,16257,15919,14294,15723,15978,15303,14239,15603,15820,14199,15786,15222,14309,8187,15167,16019,15678,12270,16147,15283,16041,15767,14843,15597,16176,15225,15986,15320,16096,15826,15951,12254,15087,14297,16038,15278,16194,12280,14078,15759,15796,15719,15332,14314,8175,16028,14263,15977,16150,15307,14300,15813,15609,15848,16069,15226,15934,15710,14845,16142,16258,15985,11775,15285,14255,15309,15733,15825,12267,16044,12269,15963,15336,16026,15228,14203,15610,15774,16153,14313,15726,15800,14310,16204,15286,15487,16067,15842,14269,16163,15933,15199,15787,15095,16200,8127,16050,12275,16037,15731,16139,15344,15959,15818,14206,15612,14846,15771,15988,14321,12277,14287,15315,15828,15289,16264,16165,15725,16074,15099,16208,15310,15789,14316,15979,12031,16049,16154,15551,15738,13821,15965,15856,16166,16027,15290,15795,8190,16070,14299,15215,15317,15841,16042,12278,15318,16260,15263,16169,12281,14270,15975,15783,16082,15679,16015,14322,16156,16097,15815,15611,15331,14267,16076,15737,14311,16224,15101,8191,15292,15832,12159,16197,15223,15773,15321,16056,15333,15966,16149,15798,15734,12282,14301,15981,16184,16023,14324,15583,16052,16272,15322,14295,8159,15819,15987,16081,15279,16195,15844,16170,15790,15227,16177,15334,15931,15614,12279,15102,14318,15801,16045,12284,16100,15982,16073,14847,14302,15821,15740,16029,14328,16202,16288,15827,15324,15993,16088,16143,15735,16180,15337,15287,15990,16262,12283,16043,15727,15338,15804,13823,16172,15830,16209,14315,15607,14317,16030,15229,16259,15797,16084,16051,15311,16198,15230,16151,15833,12271,15989,15846,16098,16178,15711,16039,15345,15802,16210, 14323,15291,16075,15822,16266,16225,15340,15994,16157,14325,16054,16265,15935,15843,16112,15741,16071, 16167,15829,15346,16320,15791,14079,15293,16201,12223,15319,16046,15294,15850,16212,16104,16057,16274, 15996,14326,15836,15739,16228,14329,16155,16077,15852,15323,8189,16268,15799,15348,16179,16085,15335, 16174,15613,15983,12286,14207,16261,15834,16078,15849,16216,16053,15352,14330,16289,16173,16203,15967, 15805,16083,15103,16240,16060,15860,15325,15742,16090,12287,16158,16171,14327,15835,16280,16199,14332, 16226,15803,15339,15858,16099,16031,16186,15326,15341,16273,12255,16058,16181,15831,15991,16101,16292, 14331,15823,16086,16205,15857,15295,16232,15599,16276,16106,16213,15845,16047,16092,16182,15347,16296, 14319,16120,16206,15998,15349,16321,16089,16263,15864,16185,16218,16102,15847,16290,16055,16113,15231, 15775,15342,16214,16227,16275,15997,15838,16322,14271,16188,16270,16059,16108,15851,16233,15350,15806, 16079,16267,15353,16304,16217,16230,16105,15853,16114,16277,16159,14334,15995,16328,16211,16091,15837, 15354,16236,16061,15327,16269,12285,16175,15861,16291,16324,16220,14335,16062,16284,16116,15854,15356, 16103,16241,16187,16229,16281,16093,14303,15866,16294,15807,15343,16336,16183,16234,15859,16278,16297, 16207,16107,15865,16248,16094,16325,16282,15862,16242,16219,16109,16293,16189,16312,15351,16087,16329, 15839,16298,16117,16221,16244,16352,16190,15868,16308,16110,15355,16231,16323,16305,16118,15615,16279, 16235,16330,15999,16300,16121,15357,16271,16222,16337,15743,16115,14333,16326,16306,16215,15358,16238, 16283,16095,16243,15863,16332,16122,16295,16338,16249,16285,16353,15870,16124,16246,16301,16340,16237, 16302,16111,16344,15867,16307,16286,16245,16327,16354,16063,16252,16191,16310,16331,16356,16313,16123, 16250,16341,16223,15359,16299,16334,16119,16360,16316,16239,16309,16339,16125,16333,16368,16314,16253, 16346,15855,16355,16342,16287,16247,16357,16345,16126,16362,16311,16348,16303,16251,16361,16358,16317, 16254,16369,16335,16364,15869,16347,16318,16370,16315,16359,16349,16372,16343,16366,16350,16376,15871, 16363,16365,16371,16373,16127,16374,16377,16255,16378,16375,16380,16379,16367,16319,16382,16383,16351, 16381]

**Sequence group 5: Z5_16384**

[0,1,2,7,3,8,11,24,4,10,13,28,16,33,35,77,5,12,14,32,19,38,47,81,22,46,42,88,57,96,102,168,6,17,21,40, 23,45,51,90,29,55,59,97,72,111,117,188,34,61,75,115,80,124,134,200,87,136,147,227,152,239,260,389,9,18,26,54, 30,58,71,105,36,76,62,118,84,128,141,209,44,74,86,135,92,144,151,233,100,154,170,251,186,269,289,436,53,89,9 8,150,112,161,179,266,122,180,199,281,211,306,325,477,138,207,230,312,236,326,352,512,257,361,382,540,403,5 68,617,889,15,25,31,73,39,79,82,140,48,85,93,149,101,159,165,263,56,94,103,162,116,178,196,284,127,197,208,2 99,232,321,346,499,64,109,123,185,129,198,215,315,148,228,237,328,256,359,374,539,163,247,267,365,282,398,4 06,565,308,422,459,602,487,640,721,892,69,125,143,218,158,235,254,363,169,258,272,388,290,405,435,591,194,2 85,300,419,327,449,482,655,342,491,520,689,548,735,766,1044,214,316,336,465,366,498,525,709,402,535,566,75 2,604,773,850,1140,431,577,618,812,635,873,907,1217,715,930,966,1201,1009,1280,1387,1799,20,37,41,91,49,95, 106,177,50,107,119,189,131,210,219,344,63,120,132,224,145,231,245,345,153,244,261,380,286,401,411,564,67,14 2,155,226,173,248,268,399,183,278,291,414,305,446,470,630,181,301,319,445,341,483,503,690,369,527,549,733,5 74,760,821,1113,78,167,174,275,192,297,317,437,201,324,333,479,353,510,533,730,259,347,368,518,391,545,573, 755,425,584,624,807,658,870,914,1190,296,384,415,559,444,601,628,853,473,648,670,887,722,946,978,1259,522, 719,738,967,756,1011,955,1306,832,1101,1141,1409,1153,1549,1621,1892,83,190,195,340,249,358,373,526,276,3 78,392,554,424,586,622,856,292,420,441,589,462,629,662,896,492,673,708,937,753,974,1041,1324,343,447,468,6 61,501,698,744,957,552,745,768,1032,833,1005,1123,1423,599,796,863,1104,898,1151,1196,1500,948,1207,1205, 1601,1312,1651,1713,2106,383,489,529,747,585,771,820,1061,625,854,876,1144,925,1164,1203,1540,663,904,961,
1191,987,1213,1317,1655,1057,1332,1382,1726,1461
,1822,1883,2333,731,969,1023,1320,1119,1327,1441,
1759,1
137,1431,1511,1860,1581,1944,2071,2526,1169,1555
,1643,1982,1693,2087,2028,2593,1792,2172,2234,27
82,2364,
2887,3037,3442,27,43,52,99,60,121,133,216,66,137,1
46,223,157,242,246,395,68,156,166,241,175,298,309,
430,203,
311,339,474,355,505,531,750,70,172,191,304,205,33
7,349,496,217,362,375,536,397,569,596,775,229,386,
410,580,
439,621,642,839,451,631,676,903,687,935,970,1397,
110,204,212,354,225,376,396,558,252,412,426,609,4
55,652,6
72,861,274,429,467,638,494,684,693,916,517,696,70
6,977,793,1012,1090,1427,293,493,508,704,544,740,
749,995,
572,792,824,1056,880,1114,1145,1516,607,848,899,1
150,949,1187,1266,1587,1020,1277,1336,1656,1383,
1733,18
39,2312,113,221,243,407,271,427,461,657,288,471,4
97,697,523,713,724,989,323,509,542,728,571,786,81
5,1050,6
05,835,878,1134,917,1171,1236,1524,350,556,595,82
2,643,865,862,1174,664,905,932,1218,999,1271,1292
,1666,7
12,951,1015,1281,1053,1348,1386,1763,1100,1417,1
480,1861,1598,1959,2080,2548,371,615,650,909,692,
945,100
1,1278,783,1019,1067,1372,1075,1393,1455,1815,79
8,1070,1099,1439,1181,1476,1565,1941,1252,1590,1
638,1991,
1711,2124,2184,2614,837,1200,1227,1527,1302,1605
,1650,2049,1337,1706,1771,2164,1841,2247,2347,28
10,1486,
1776,1869,2263,1976,2381,2439,2995,2056,2500,258
6,3083,2694,3245,3406,4041,130,253,279,472,320,50
7,538,7
59,330,547,578,789,610,829,895,1239,364,597,656,8
57,678,942,922,1257,699,962,1007,1331,1062,1357,1
402,179
3,440,666,701,938,782,993,1025,1379,788,1066,1086
,1404,1117,1456,1498,1905,800,1110,1161,1493,124
9,1560,1
629,2000,1287,1686,1709,2138,1774,2186,2287,2759
,453,780,785,1054,805,1072,1131,1468,845,1184,122
4,1543,
1273,1616,1698,2095,1014,1244,1305,1635,1342,172
7,1781,2177,1463,1788,1874,2269,1981,2367,2428,2
989,108
1,1346,1438,1731,1487,1855,1915,2307,1574,1954,2
014,2423,2088,2506,2608,3151,1646,2065,2154,2583
,2232,26
67,2752,3268,2325,2793,2881,3386,2934,3587,3612,
4472,466,808,828,1233,990,1264,1290,1680,1035,13
29,1369,
1746,1452,1807,1898,2293,1093,1398,1483,1826,153
5,1925,2019,2406,1620,2083,2008,2472,2178,2601,2
693,317
8,1253,1502,1559,1963,1663,2031,2144,2565,1721,2
157,2228,2671,2278,2704,2819,3366,1843,2252,2342
,2774,24
44,2900,2972,3512,2522,3066,3131,3681,3253,3782,
3814,4280,1343,1567,1714,2160,1801,2214,2253,273
7,1889,2
358,2387,2863,2482,2906,3089,3605,1910,2464,2572
,3058,2687,3154,3170,3804,2799,3277,3340,3885,34
85,4062,
4171,4774,2102,2649,2674,3226,2841,3288,3393,393
2,2926,3505,3535,4150,3708,4179,4497,5010,3018,3
658,376
1,4338,3911,4394,4585,5215,3992,4635,4752,5388,4
891,5534,5659,6334,139,114,65,287,104,264,184,524
,126,187,
206,456,222,360,329,600,160,220,240,338,265,417,3
77,705,307,393,434,567,478,787,646,985,171,250,27
0,400,31
0,423,484,620,331,511,450,890,553,669,716,1395,35
6,490,583,685,534,748,844,1177,611,826,784,1031,9
15,1241,
1076,1768,202,295,314,464,351,504,562,726,387,637
,513,767,598,801,872,1097,421,551,681,840,647,976,
823,113
9,590,879,1010,1199,940,1466,1279,2169,452,677,61
4,926,774,894,1045,1226,714,1111,965,1352,1028,13
00,1683,
1546,810,1059,1127,1513,1175,1373,1425,1820,1229
,1593,1474,2069,1658,2443,1942,2975,234,334,372,5
41,409,
576,636,852,448,729,603,883,671,923,998,1318,480,
644,776,936,707,1088,968,1289,804,1034,1162,1385,
1116,14
47,1573,1872,519,758,688,1003,875,1064,1172,1415,
843,1247,1091,1704,1220,1508,1525,2010,928,1158,
1330,15
71,1276,1614,1749,2509,1410,1791,1671,2046,1895,
2193,2285,3108,570,791,902,1135,831,1179,1296,15
89,956,1
360,1222,1852,1429,1636,1742,2135,1013,1265,1449
,1689,1541,1783,1998,2225,1334,1930,1806,2404,20
61,2330,
2590,3327,1069,1485,1583,1949,1370,1864,2025,264
6,1649,2120,2206,2427,1890,2787,2528,4291,1712,2
167,226
8,2740,2338,2606,2699,3573,2078,2868,2941,3223,3
034,3940,3400,5443,283,394,428,639,485,739,674,98
4,506,69
5,867,1042,778,1106,1163,1472,560,813,751,1129,87
1,1283,1079,1539,944,1185,1315,1603,1231,1813,17
30,2489,
606,885,830,1396,1022,1173,1237,1619,924,1269,13
45,1966,1435,1677,1785,2236,1055,1469,1377,1850,
1585,175
6,1980,2322,1521,1928,2038,2379,2134,2542,2768,3

202,654,1122,913,1304,971,1496,1356,1866,1080,14
13,1553,
1797,1613,1945,2053,2446,1194,1690,1526,2198,145
9,1973,2033,2711,1790,2118,2250,2552,2328,2639,2
886,364
5,1263,1725,1607,2072,1836,2176,2385,2838,1958,2
469,2211,2732,2276,3077,2958,3533,1653,2356,2603
,3015,25
04,2907,3303,3499,2675,3234,3110,3860,3457,3746,
4069,5590,742,1000,1148,1467,1225,1533,1744,2091
,1299,18
79,1577,2161,1673,2018,2336,2829,1103,1633,1717,
2270,1859,2544,2204,2779,2016,2411,2486,3042,211
5,3274,2
948,4482,1401,1764,1943,2629,2100,2436,2370,3196
,1829,2516,2749,2994,2664,3091,3382,3770,2258,27
17,2596,
3137,2832,3592,3300,3908,2960,3413,3664,4145,354
0,4025,4595,5006,1481,1974,2151,2511,1881,2866,2
612,322 I,
2314,2637,3025,3351,2743,3449,3693,4255,2047,291
3,2805,3481,3063,3758,3559,4210,3254,3623,3966,4
109,38
53,4748,4534,5276,2419,3158,2980,3735,3371,4312,
3634,4446,2875,3977,3819,4572,3882,4672,4888,672
1,3119,4
277,4155,5043,4056,4813,5160,5754,4421,5103,4981
,6035,5344,7320,5855,7906,370,458,532,765,593,795
,869,11
67,633,980,834,1322,919,1215,1389,1739,679,881,10
48,1246,959,1531,1309,1811,1108,1454,1609,2191,1
421,187
3,1961,2561,723,1038,988,1366,1124,1443,1588,200
3,1251,1696,1510,1908,1665,2062,2299,2727,1189,1
626,1558,
2045,1755,2242,2142,2654,1857,2274,2409,3394,245
4,2986,2885,3733,818,1065,1235,1528,1365,1596,19
35,2113,
1160,1641,1778,2196,1676,2365,2217,2808,1341,182
4,1875,2537,1719,2296,2479,3023,2086,2573,2353,2
924,270
9,3117,3293,4024,1519,1924,2145,2425,2022,2631,2
554,3193,2251,2855,2734,3098,2535,3313,3431,3946
,1995,28
97,2798,3358,3045,3626,3513,4222,2684,3490,3713,
4708,3843,4528,4390,5482,933,1391,1212,1751,1294
,2129,16
99,2461,1552,1808,2012,2433,1952,2346,2624,3204,
1515,2260,2040,2761,1921,2570,2525,3320,2210,269
2,2931,3
128,2850,3461,3582,4165,1661,2105,2319,2645,2400
,3007,2817,3655,2122,2778,3165,3523,2915,3419,38
11,4322,
2462,3101,3005,3602,3330,3988,3724,4456,3282,383
8,4192,4559,4051,4768,4864,6122,1845,2495,2221,2
977,234
5,2877,3141,3748,2562,3438,3080,3686,3231,3873,3
968,4609,2682,3362,3200,4037,3599,3926,4264,5249
,3491,44
11,4077,4735,4324,4955,5136,5717,2800,3214,3635,
4156,3428,4231,4437,4902,3833,4664,4302,5077,456
9,5186,5
371,5970,3737,4459,4674,5600,4875,5296,5431,6402
,4368,5518,5791,6262,5907,6534,6906,8201,1112,14
53,1355,
2030,1600,2127,1968,2621,1678,1903,2348,3016,224
4,2715,2888,3494,1761,2290,2182,2771,2519,3295,2
859,361
4,2452,2952,3106,3870,3212,3718,4090,4695,1937,2
546,2417,2983,2658,3071,3127,3757,2304,3183,3380
,4097,35
51,4011,3938,4805,2789,3392,3643,3917,3502,4202,
4335,5030,3318,4423,4168,4923,4549,5198,5331,615
2,2097,2
372,2822,3370,2627,3265,3611,4122,2997,3790,3469
,4015,2968,4266,4379,5068,3087,3563,3668,4723,38
30,4311,
4504,5656,3980,4645,4425,5176,4841,5305,5566,631
7,3242,3705,4134,4513,3862,4933,4650,5395,4287,4
582,503
3,5466,4759,5959,5682,6487,4048,4913,5165,5726,5
307,6085,5932,6788,5126,5821,6274,7063,6136,6644
,7197,84
28,2429,2725,2894,3590,3176,3960,3521,4414,3069,
3727,3695,4619,3896,4782,4557,5544,3337,4180,384
1,4525,4
299,4687,5044,5452,4118,4946,5152,5693,4874,5833
,6069,6775,3471,4001,4447,4826,4236,5187,4994,58
05,4344,
5057,5281,6368,5507,5936,5969,7011,4642,5419,564
2,6059,5359,6500,6188,6942,5201,6247,6620,7478,6
460,713
0,7422,9139,3767,4399,4540,5404,4836,5149,5629,6
098,4719,5272,5478,6214,5780,6590,6392,7231,5017
,5576,58
08,6523,5943,6304,6758,7638,5985,6878,6655,7355,
6957,7583,7772,9613,5321,5844,6111,6747,6237,680
2,7100,7
491,6432,7088,6931,7930,7291,7942,7717,8911,6617
,7220,7450,8064,7612,8134,8296,8618,7798,8324,84
85,8776,
8643,10303,9327,9483,108,164,176,273,193,277,318,
442,213,302,335,475,379,516,537,803,238,322,348,5
14,404,5
50,619,817,433,616,582,858,683,901,939,1245,255,3
81,416,575,438,613,649,866,486,667,694,906,770,97
9,1016,1
328,521,710,794,1002,814,1043,1087,1375,855,1095,
1146,1484,1178,1532,1612,2050,294,385,463,660,49
5,691,76
4,954,543,799,717,1018,846,1063,1128,1414,592,790
,851,1092,888,1138,1166,1501,927,1188,1255,1570,1
321,164
0,1715,2195,659,859,911,1157,983,1210,1288,1632,1
033,1293,1371,1682,1419,1767,1831,2311,1105,1408
,1491,1 795,1512,1834,1920,2416,1595,1957,2021,2494,2090
,2578,2714,3397,357,460,502,777,561,809,825,1126,
623,847,
893,1152,931,1204,1230,1623,680,897,943,1214,100
8,1285,1358,1697,1058,1359,1412,1747,1495,1823,1
906,2382,
725,972,1037,1316,1068,1364,1430,1805,1147,1488,
1518,1842,1592,1951,1996,2493,1219,1557,1634,197
2,1688,
2076,2099,2571,1775,2150,2267,2673,2351,2775,298
2,3402,757,1047,1133,1440,1198,1507,1582,1965,12
50,1599,
1652,2044,1716,2096,2190,2644,1350,1701,1748,214
3,1835,2233,2327,2813,1894,2361,2442,2903,2518,3
021,309
7,3753,1428,1810,1878,2281,1977,2378,2458,2949,2
089,2485,2575,3059,2680,3116,3302,3955,2180,2602
,2716,32
11,2758,3357,3434,4117,2965,3489,3568,4085,3670,
4251,4469,5243,408,546,579,884,626,900,958,1282,6
32,963,1
021,1333,1078,1418,1446,1900,720,1026,1082,1473,
1142,1494,1551,1902,1183,1550,1617,2015,1703,208
4,2117,2
569,746,1132,1192,1479,1267,1562,1639,2077,1308,
1670,1722,2126,1766,2223,2294,2747,1298,1754,181
7,2219,1
893,2335,2389,2905,1984,2465,2524,3019,2595,3079
,3233,3902,806,1240,1268,1660,1344,1741,1812,219
7,1376,1
828,1863,2318,1926,2408,2478,3011,1606,1907,1979
,2435,2052,2508,2594,3067,2159,2620,2730,3199,28
21,3348,
3448,4065,1737,2029,2133,2558,2216,2672,2739,330
8,2302,2797,2847,3391,2985,3529,3601,4208,2450,2
974,302
9,3570,3068,3673,3546,4309,3260,3877,3957,4510,3
984,4780,4919,5406,842,1338,1354,1888,1564,1948,
1994,246
0,1664,2009,2058,2541,2158,2628,2724,3316,1724,2
147,2209,2636,2275,2742,2828,3411,2363,2856,2947
,3509,30
60,3589,3745,4342,1899,2224,2289,2827,2384,2923,
3041,3550,2534,3043,3105,3723,3262,3662,3923,453
6,2663,3
171,3334,3881,3417,3979,4076,4686,3532,4095,4093
,4881,4320,4968,5087,5774,2024,2355,2467,3047,26
26,3114,
3230,3787,2731,3310,3367,3964,3478,4010,4089,476
5,2831,3427,3558,4067,3622,4108,4329,4977,3779,4
356,445
8,5109,4614,5283,5392,6148,3013,3578,3700,4334,3
914,4346,4576,5173,3948,4555,4707,5353,4838,5501
,5711,64
52,4021,4790,4953,5561,5053,5737,5640,6548,5232,
5879,5989,6837,6194,6992,7205,7767,469,587,653,9
18,703,1
030,1083,1433,741,1096,1143,1471,1197,1544,1556,
2068,754,1193,1234,1538,1274,1743,1782,2175,1388
,1789,18
86,2303,1934,2393,2474,3052,761,1262,1340,1762,1
400,1880,1912,2375,1434,1964,2001,2487,2074,2580
,2656,31
24,1489,2037,2112,2610,2202,2722,2777,3279,2241,
2748,2865,3425,2896,3501,3579,4488,975,1394,1424
,1927,14
78,2002,2070,2551,1575,2119,2165,2691,2255,2807,
2854,3326,1657,2173,2288,2767,2369,2891,2912,345
6,2432,2
919,2940,3598,3164,3675,3850,4546,1729,2368,2401
,2936,2507,3033,3050,3641,2588,3163,3241,3777,33
77,3904,
3965,4718,2688,3298,3418,3976,3536,4058,4221,485
0,3692,4241,4364,4978,4463,5122,5316,6116,992,14
58,1545,
2104,1647,2166,2273,2820,1710,2295,2376,2921,245
1,2957,2993,3630,1827,2407,2501,3004,2587,3148,3
219,376
5,2681,3269,3369,3943,3458,4023,4162,4733,1914,2
549,2653,3238,2784,3336,3329,4032,2835,3430,3496
,4119,36
50,4229,4276,5000,2956,3538,3683,4252,3769,4386,
4467,5182,3872,4524,4647,5355,4873,5524,5724,648
3,1988,2
708,2803,3436,2911,3527,3654,4243,3143,3691,3798
,4442,3816,4480,4603,5269,3175,3805,3869,4571,40
45,4639,
4809,5492,4196,4860,4945,5574,5084,5804,5901,658
4,3271,4083,4141,4742,4298,4887,4966,5678,4365,5
075,519
6,5868,5320,6007,6171,6875,4659,5205,5368,6031,5
551,6221,6314,7150,5689,6404,6536,7273,6703,7499
,7714,85
33,1074,1576,1675,2298,1818,2399,2491,3076,1849,
2515,2605,3156,2696,3252,3409,4167,1971,2660,281
5,3317,2
874,3520,3468,4206,2927,3560,3666,4354,3788,4410
,4498,5234,2203,2837,2929,3511,3139,3639,3704,44
54,3155,
3796,3840,4500,3912,4605,4682,5427,3180,3894,400
0,4671,4188,4800,4931,5589,4263,5041,5079,5829,5
200,590
3,6071,6806,2248,3135,3146,3774,3192,3807,3937,4
626,3292,4053,4131,4770,4233,4909,5062,5751,3682
,4178,43
07,4940,4374,5111,5212,5889,4616,5223,5378,6042,
5559,6199,6298,7140,3829,4384,4568,5120,4661,534
3,5448,6
106,4825,5515,5614,6288,5739,6416,6573,7364,4957
,5702,5853,6532,5984,6664,6796,7527,6135,6850,69
82,7687,
7058,7957,7993,9053,2283,3201,3251,4154,3632,421
7,4272,5029,3732,4351,4434,5148,4594,5256,5416,6
082,385
8,4490,4652,5293,4756,5465,5625,6261,4917,5728,5
602,6363,5891,6560,6701,7404,4198,4691,4798,5530,4991,56
48,5838,6508,5100,5857,5979,6669,6056,6717,6890,
7662,5325,6016,6161,6825,6323,7008,7114,7858,644
3,7246,7
340,8077,7509,8209,8251,8827,4376,4811,5089,5862
,5245,5956,6018,6772,5401,6185,6232,6956,6377,70
17,7283,
7983,5438,6352,6517,7233,6691,7368,7391,8237,686
1,7540,7632,8344,7822,8560,8694,9400,5764,6640,6
674,747
4,6926,7554,7698,8398,7046,7848,7887,8668,8116,8
704,9081,9664,7179,8049,8184,8894,8372,8963,9188
,9885,84
79,9241,9374,10068,9531,10221,10350,11014,1120,9
96,736,1707,952,1624,1313,2456,1051,1325,1405,22
56,1464,
1955,1847,2669,1208,1450,1536,1884,1630,2139,200
6,2937,1772,2059,2187,2576,2316,3152,2790,3619,1
260,156
8,1644,2081,1786,2155,2339,2720,1853,2413,2238,3
398,2539,2844,2969,4484,1938,2359,2617,2892,2483
,3048,32
89,4038,2697,3247,3144,3720,3454,4173,3817,5191,
1380,1734,1802,2279,1918,2390,2566,3000,2042,276
5,2420,3
103,2661,3181,3355,3867,2148,2531,2882,3280,2794
,3594,3239,3953,2641,3373,3671,4081,3516,4621,42
48,5875,
2245,2870,2705,3482,3121,3407,3754,4138,2962,389
8,3566,4397,3711,4295,5036,4775,3207,3783,3929,4
713,403
3,4443,4542,5279,4147,4866,4636,5708,4983,6319,5
496,7118,1505,1870,1992,2498,2109,2599,2763,3306
,2230,30
09,2677,3383,2852,3473,3647,4330,2323,2785,3125,
3507,2945,3846,3575,4268,3189,3730,4006,4465,390
9,4587,4
822,5373,2440,3073,2901,3659,3364,3792,4027,4520
,3285,4185,3855,5073,4124,4702,4737,5608,3486,39
94,4352,
4818,4239,4906,5155,6421,4511,5230,5012,5673,541
1,5916,6067,7309,2584,3160,3423,3944,3258,4042,4
285,485
7,3547,4417,4127,5339,4552,4941,5139,5825,3679,4
218,4590,5047,4766,5216,5585,5974,4360,5474,5253
,6257,56
96,6143,6543,7614,3802,4657,4843,5508,4439,5360,
5635,6636,4964,5798,5941,6295,5402,6842,6454,884
0,5085,5
872,6039,6778,6156,6569,6709,7939,5722,6964,7069
,7470,7201,8410,7705,10132,1694,2066,2170,2772,2
343,303
0,2861,3617,2397,2917,3342,3750,3132,3887,4008,4
632,2559,3216,3056,3933,3353,4257,3822,4761,3525
,4054,43
26,4883,4151,5266,5117,6387,2685,3387,3256,4486,
3697,4029,4163,4915,3475,4226,4381,5535,4563,502
4,5219,5
991,3775,4627,4452,5337,4846,5169,5557,6131,4728
,5471,5661,6218,5823,6473,6817,7442,2811,3919,34
45,4305,
3584,4678,4407,5363,3826,4516,4787,5239,4904,550
2,5684,6325,4072,5049,4739,5926,4610,5546,5650,6
730,522
8,5793,6012,6489,6140,6625,6989,8032,4214,5107,4
893,5712,5311,5887,6228,6921,5520,6358,5952,6765
,6053,72
65,7094,7884,4973,6183,6566,7174,6412,7018,7578,
7839,6675,7484,7312,8313,7787,8166,8570,10283,30
38,3651,
3972,4623,4136,4753,5144,5744,4293,5385,4831,586
3,5015,5622,6153,6908,3879,4937,5093,6043,5351,6
477,593
8,6832,5619,6270,6383,7211,5789,7535,7078,9064,4
495,5183,5498,6609,5760,6309,6204,7432,5299,6434
,6791,71
46,6659,7285,7682,8194,6023,6741,6553,7346,6912,
7964,7572,8368,7096,7725,8055,8662,7894,8515,919
9,9658,4
648,5548,5848,6424,5389,6961,6579,7467,6118,6622
,7188,7645,6782,7778,8095,8796,5675,7028,6868,78
17,7241,
8180,7920,8741,7510,8005,8447,8623,8304,9369,912
6,9952,6283,7374,7126,8153,7669,8865,8018,9023,6
975,846
1,8257,9173,8339,9290,9526,11374,7324,8822,8673,
9699,8551,9447,9826,10448,8995,9764,9632,10725,1
0026,11
902,10546,12392,1985,2264,2475,3094,2650,3168,33
45,4017,2754,3607,3266,4339,3463,4114,4473,5134,
2878,33
78,3762,4183,3555,4749,4315,5262,3890,4601,4896,
5912,4532,5375,5526,6502,2991,3740,3628,4430,392
4,4578,4
855,5595,4194,5059,4704,5434,4996,5698,6092,6756
,4063,4926,4796,5669,5167,6001,5835,6646,5348,60
49,6267,
7699,6338,7135,6987,8149,3227,3794,4158,4743,442
8,4871,5484,5787,3997,4950,5207,5921,5019,6195,5
962,687
3,4372,5289,5379,6468,5096,6088,6373,7185,5735,6
518,6178,7043,6726,7321,7562,8514,4725,5462,5839
,6292,56
31,6612,6492,7427,6014,6946,6768,7295,6466,7592,
7752,8416,5581,7003,6858,7653,7215,8009,7859,875
7,6687,7
827,8121,9331,8291,9121,8957,10170,3497,4476,410
5,5158,4282,5814,5063,6347,4785,5257,5610,6305,5
513,616
8,6600,7445,4716,6026,5664,6808,5457,6514,6448,7
604,5950,6699,7053,7336,6939,7792,7951,8686,4987
,5770,61
26,6634,6252,7165,6886,8045,5801,6830,7385,7872,
7031,7736,8246,8875,6349,7300,7163,7978,7618,847
3,8138,9
034,7546,8283,8719,9160,8546,9392,9501,10813,532

7,6398,5967,7121,6166,6977,7351,8168,6504,7761,7268,8084,7480,8329,8450,9212,6685,7657,7437,8528,7975,8391,8806,9920,7829,8984,8582,9357,8877,9602,9800,10410,6862,7458,8020,8675,7749,8766,9013,9543,8278,9279,8853,9734,9170,9855,10050,10663,8156,9038,9292,10292,9512,9976,10119,11081,8930,10202,10483,10950,10599,11202,11543,12623,3900,4599,4402,5644,4877,5811,5538,6595,5026,5424,6172,7176,6003,6736,6993,7834,5179,6077,5897,6821,6438,7566,6951,7995,6335,7083,7305,8325,7456,8129,8597,9315,5487,6480,6281,7131,6651,7254,7334,8178,6101,7410,7680,8606,7911,8500,8406,9438,6845,7695,8029,8379,7843,8731,8890,9685,7601,8999,8689,9567,9147,9867,10011,10840,5756,6207,6896,7667,6604,7523,7989,8637,7152,8219,7802,8504,7109,8808,8944,9725,7278,7925,8060,9345,8273,8863,9089,10345,8464,9254,9001,9844,9478,9986,10258,10996,7494,8111,8650,9101,8316,9578,9259,10075,8833,9183,9689,10156,9381,10652,10374,11158,8541,9556,9833,10418,9988,10778,10624,11435,9789,10513,10960,11684,10827,11302,11799,12797,6299,6754,6999,7961,7400,8437,7870,8989,7251,8143,8097,9222,8356,9410,9157,10232,7627,8705,8289,9116,8849,9306,9700,10141,8632,9593,9820,10384,9511,10524,10759,11423,7804,8490,9025,9463,8772,9857,9645,10497,8900,9712,9956,11049,10192,10630,10662,11632,9249,10105,10332,10749,10039,11169,10872,11575,9870,10936,11281,12035,11131,11739,11990,13318,8190,8968,9135,10086,9472,9815,10320,10791,9341,9946,10166,10902,10472,11253,11073,11829,9670,10268,10501,11193,10635,10985,11407,12170,10676,11514,11312,11933,11588,12123,12282,13647,10001,10536,10803,11397,10927,11447,11715,12046,11108,11706,11566,12412,11876,12420,12234,13158,11277,11821,12012,12518,12148,12570,12694,12942,12303,12716,12840,13060,12961,14091,13450,13558,182,262,280,413,303,418,476,641,332,454,500,682,555,734,762,1098,367,481,515,732,588,779,868,1118,627,864,819,1168,950,1223,1270,1642,390,557,608,811,634,860,908,1180,700,929,964,1228,1060,1319,1361,1738,743,981,1089,1347,1115,1399,1448,1798,1165,1460,1520,1923,1561,1983,2079,2589,443,563,668,921,711,960,1049,1286,769,1094,991,1363,1154,1420,1499,1840,836,1084,1159,1457,1206,1509,1547,1946,1254,1572,1654,2027,1732,2108,2199,2751,920,1170,1232,1534,1323,1597,1692,2101,1384,1700,1794,2162,1846,2262,2334,2889,1475,1833,1933,2291,1960,2337,2438,3006,2057,2481,2553,3092,2632,3187,3339,4098,528,665,718,1071,797,1107,1130,1497,874,1155,1211,1529,1258,1591,1622,2092,947,1216,1275,1602,1351,1687,1777,2179,1416,1779,1838,2235,1940,2321,2418,2967,1004,1307,1390,1728,1426,1784,1862,2301,1523,1929,1967,2349,2054,2473,2523,3090,1608,2013,2103,2497,2168,2615,2643,3179,2271,2703,2834,3296,2932,3412,3644,4103,1040,1403,1504,1876,1586,1953,2039,2490,1648,2064,2121,2582,2200,2638,2746,3264,1765,2183,2237,2695,2341,2801,2908,3451,2405,2943,3036,3553,3123,3687,3773,4493,1858,2306,2386,2849,2503,2964,3054,3606,2630,3082,3184,3726,3304,3791,3993,4710,2733,3213,3341,3897,3395,4061,4144,4890,3625,4203,4290,4854,4400,5032,5265,6084,594,772,816,1202,877,1221,1291,1684,886,1295,1368,1745,1437,1844,1882,2412,994,1374,1442,1911,1514,1936,2005,2415,1566,2004,2085,2545,2185,2623,2666,3177,1027,1503,1578,1917,1667,2017,2107,2616,1718,2146,2205,2676,2259,2788,2867,3381,1705,2243,2313,2783,2403,2914,2976,3554,2510,3062,3130,3685,3205,3752,3922,4655,1102,1637,1668,2132,1758,2227,2308,2753,1800,2331,2371,2899,2445,2998,3075,3677,2073,2422,2505,3028,2591,3111,3203,3736,2712,3237,3361,3884,3462,4052,4161,4828,2222,2564,2683,3166,2780,3294,3372,4003,2876,3433,3495,4092,3649,4247,4328,4982,3044,3636,3694,4292,3738,4404,4265,5092,3951,4630,4712,5306,4747,5594,5743,6254,1149,1750,1770,2396,2020,2470,2521,3055,2137,2536,2597,3150,2710,3246,3352,4014,2208,2700,2770,3255,2842,3376,3472,4113,2944,3506,3604,4224,3728,4313,4483,5127,2410,2792,2860,3470,2971,3577,3707,4271,3142,3709,3781,4462,3952,4391,4673,5336,3287,3852,4036,4634,4121,4741,4842,5500,4250,4865,4863,5705,5104,5797,5923,6643,2557,2935,3064,3714,3244,3789,3918,4527,3363,4005,4068,4722,4191,4773,4859,5577,3477,4135,4279,483 0,4350,4880,5114,5807,4519,5143,5255,5947,5418,6
128,6238,7027,3678,4301,4436,5119,4665,5132,5383
,6011,47
01,5358,5523,6202,5660,6355,6576,7343,4781,5607,
5781,6420,5884,6606,6501,7441,6074,6753,6866,773
5,7075,7
890,8107,8672,675,827,912,1242,973,1378,1444,186
5,1024,1462,1517,1909,1584,1997,2011,2607,1036,1
579,1628,
1990,1672,2229,2277,2729,1814,2284,2395,2880,245
3,2981,3070,3719,1046,1662,1753,2254,1825,2388,2
426,295
9,1868,2488,2527,3084,2613,3188,3278,3800,1931,2
574,2659,3222,2760,3350,3414,3967,2809,3385,3514
,4133,35
45,4216,4303,5286,1311,1819,1851,2447,1916,2529,
2609,3159,2032,2668,2718,3315,2823,3443,3504,402
6,2128,2
726,2858,3405,2953,3541,3564,4170,3024,3572,3597
,4323,3844,4406,4598,5347,2213,2951,2990,3591,31
09,3699,
3717,4369,3197,3842,3931,4518,4078,4656,4724,553
3,3312,3989,4123,4736,4254,4820,4999,5672,4426,5
021,515
1,5809,5260,5960,6165,6997,1335,1896,1999,2648,2
114,2719,2840,3460,2192,2869,2961,3574,3046,3615
,3657,43
58,2329,2996,3100,3669,3195,3825,3907,4505,3305,
3959,4070,4696,4172,4783,4934,5545,2430,3157,327
5,3927,3
420,4040,4031,4793,3480,4140,4211,4892,4378,5007
,5061,5832,3613,4256,4415,5034,4509,5177,5264,60
21,4625,
5324,5453,6203,5694,6380,6591,7372,2514,3333,343
9,4146,3562,4245,4383,5023,3820,4424,4541,5237,4
558,527
7,5409,6112,3857,4548,4620,5377,4806,5444,5628,6
346,4970,5681,5773,6433,5919,6673,6774,7477,3961
,4852,49
12,5554,5083,5710,5795,6541,5153,5908,6036,6740,
6170,6884,7049,7773,5468,6047,6215,6907,6409,710
6,7198,8
052,6552,7297,7429,8177,7600,8403,8619,9434,1432
,2034,2153,2873,2315,2988,3088,3747,2357,3118,32
18,3834,
3319,3941,4111,4939,2496,3283,3453,4016,3522,423
7,4181,4980,3581,4281,4395,5141,4529,5204,5295,6
076,276
2,3484,3583,4225,3815,4367,4441,5250,3832,4539,4
586,5297,4663,5410,5495,6280,3861,4646,4764,5483
,4962,56
18,5755,6451,5045,5871,5914,6696,6041,6776,6948,
7703,2816,3812,3824,4514,3876,4550,4690,5430,398
3,4814,4
903,5583,5011,5733,5894,6621,4413,4949,5091,5767
,5164,5949,6052,6762,5420,6065,6224,6917,6418,70
80,7182,
8042,4575,5175,5372,5958,5470,6193,6303,6986,564
7,6369,6476,7173,6608,7308,7466,8270,5786,6565,6
722,742
3,6860,7559,7692,8434,7016,7748,7881,8593,7960,8
862,8897,9943,2851,3886,3939,4924,4359,4993,5056
,5861,44
71,5137,5227,5988,5400,6097,6266,6960,4608,5288,
5459,6139,5567,6322,6486,7149,5741,6597,6465,725
0,6764,7
455,7598,8312,4972,5506,5616,6385,5822,6511,6706
,7396,5937,6728,6855,7564,6932,7613,7789,8568,61
76,6893,
7040,7723,7208,7907,8017,8763,7333,8152,8242,898
6,8414,9113,9156,9722,5166,5630,5925,6734,6086,6
829,689
5,7666,6248,7064,7117,7857,7264,7917,8187,8887,6
291,7238,7407,8140,7589,8275,8301,9144,7757,8446
,8538,92
46,8728,9460,9590,10280,6633,7532,7570,8376,7826
,8460,8602,9302,7948,8754,8793,9564,9022,9599,99
73,1053
3,8081,8953,9085,9785,9276,9854,10072,10746,9378
,10128,10254,10923,10407,11070,11190,11818,1490,
1339,10
17,2189,1284,2093,1723,3051,1407,1736,1830,2824,
1901,2477,2354,3291,1594,1887,1987,2392,2098,269
0,2533,3
593,2266,2598,2741,3185,2895,3828,3426,4347,1659
,2023,2111,2619,2282,2707,2920,3347,2362,3003,28
06,4099,
3147,3492,3631,5282,2459,2939,3232,3542,3078,371
5,3978,4799,3321,3936,3821,4457,4166,4944,4560,6
030,180
4,2218,2297,2846,2434,2978,3174,3665,2579,3403,3
012,3778,3284,3863,4059,4617,2701,3138,3531,3969
,3429,43
19,3928,4706,3261,4075,4401,4849,4232,5426,5028,
6748,2814,3519,3328,4197,3797,4107,4494,4910,362
1,4651,4
288,5188,4448,5080,5867,5588,3893,4523,4681,5529
,4794,5238,5342,6123,4918,5688,5441,6572,5816,72
04,6351,
8023,1950,2377,2517,3096,2655,3210,3401,3999,279
6,3674,3301,4084,3500,4187,4375,5116,2904,3421,3
801,422
0,3600,4593,4297,5052,3871,4468,4769,5261,4660,5
393,5643,6220,3032,3744,3549,4388,4066,4535,4789
,5319,39
75,4958,4604,5905,4898,5516,5550,6470,4200,4757,
5138,5639,5018,5729,5995,7315,5308,6072,5842,653
5,6260,6
789,6943,8212,3191,3839,4130,4697,3949,4803,5069
,5679,4267,5211,4900,6189,5354,5769,5978,6692,44
09,4995,
5396,5878,5578,6057,6447,6849,5147,6331,6095,714
5,6559,7024,7436,8519,4545,5464,5666,6362,5233,6
209,649
7,7528,5792,6668,6814,7180,6249,7741,7344,9733,5
920,6745,6915,7673,7035,7463,7608,8845,6588,7865,7971,83
73,8103,9313,8612,10980,2174,2604,2723,3410,2922,3696,3510,4345,2984,3569,4046,4489,3809,4640,4771,5437,
3167,3903,3722,4685,4057,5040,4567,5573,4242,4815,5110,5706,4921,6109,5955,7277,3309,4088,3947,5284,443
3,4791,4935,5738,4189,5004,5172,6390,5367,5856,6060,6867,4515,5432,5247,6186,5668,6008,6415,7012,5542,63
29,6521,7102,6690,7363,7713,8348,3447,4670,4157,5088,4308,5491,5199,6211,4570,5315,5603,6081,5727,6356,6
547,7209,4837,5880,5552,6800,5415,6403,6512,7625,6070,6663,6889,7378,7022,7516,7888,8936,4990,5945,5715,
6578,6160,6760,7113,7821,6376,7245,6826,7661,6929,8170,7999,8790,5803,7061,7460,8076,7304,7918,8483,874
6,7571,8386,8214,9215,8693,9067,9470,11125,3703,4380,4732,5428,4908,5564,5983,6615,5078,6231,5654,6735,5
845,6484,7033,7808,4631,5763,5930,6919,6200,7367,6812,7731,6482,7158,7272,8115,6656,8442,7982,9955,5292,
6022,6353,7503,6630,7193,7086,8337,6147,7326,7686,8048,7553,8188,8588,9096,6901,7636,7448,8250,7811,887
0,8478,9272,8001,8630,8962,9560,8801,9416,10082,10529,5454,6405,6716,7317,6235,7863,7473,8371,6998,7514,
8090,8550,7676,8682,9004,9694,6537,7928,7766,8723,8148,9082,8826,9637,8415,8908,9349,9519,9206,10250,10
016,10812,7169,8282,8028,9056,8576,9757,8922,9912,7874,9360,9164,10056,9240,10173,10402,12153,8225,9717,
9570,10566,9453,10325,10691,11285,9884,10634,10506,11548,10879,12641,11378,13084,2512,2830,3072,3768,3
272,3849,4049,4779,3390,4333,3956,5124,4177,4886,5270,5971,3528,4079,4502,4956,4275,5560,5099,6105,4643,
5407,5718,6786,5332,6222,6381,7390,3653,4479,4355,5224,4675,5384,5677,6458,4967,5890,5519,6287,5828,656
1,6971,7650,4824,5750,5613,6531,6006,6876,6702,7539,6198,6925,7156,8604,7221,8037,7886,9052,3915,4537,49
30,5555,5222,5691,6340,6653,4760,5778,6048,6795,5852,7076,6836,7770,5162,6134,6226,7356,5933,6968,7260,8
088,6603,7409,7057,7944,7622,8223,8468,9414,5540,6318,6708,7178,6494,7505,7380,8333,6891,7847,7663,8198,
7353,8498,8656,9321,6442,7902,7755,8559,8120,8912,8764,9651,7584,8734,9029,10209,9194,10009,9850,11018,
4212,5273,4876,5997,5066,6681,5896,7232,5601,6099,6472,7190,6366,7047,7492,8350,5531,6903,6524,7704,631
3,7403,7339,8510,6824,7596,7956,8238,7838,8699,8858,9582,5819,6639,7007,7526,7139,8065,7785,8949,6670,77
29,8294,8777,7931,8641,9153,9767,7234,8202,8062,8882,8522,9373,9042,9924,8454,9187,9614,10044,9446,1027
3,10378,11625,6177,7289,6841,8025,7045,7876,8256,9069,7392,8667,8173,8994,8383,9229,9351,10098,7581,856
4,8343,9429,8879,9296,9703,10784,8736,9874,9481,10237,9769,10477,10667,11248,7759,8361,8924,9572,8653,9
663,9902,10417,9181,10164,9746,10604,10053,10716,10906,11486,9058,9927,10175,11135,10389,10834,10969,1
1880,9825,11053,11316,11755,11429,11994,12309,13297,4653,5405,5195,6507,5701,6679,6393,7488,5858,6276,7
051,8078,6879,7631,7892,8740,6017,6955,6771,7718,7329,8471,7853,8898,7218,7988,8208,9226,8359,9033,9496,
10196,6342,7369,7167,8034,7545,8161,8236,9080,6981,8320,8586,9506,8815,9399,9310,10315,7743,8600,8934,9
284,8749,9626,9782,10553,8508,9888,9585,10441,10033,10728,10866,11653,6627,7089,7796,8574,7498,8429,889
3,9536,8053,9125,8709,9404,8013,9705,9837,10593,8183,8832,8967,10225,9177,9755,9982,11186,9363,10140,98
90,10707,10355,10842,11103,11802,8397,9018,9548,9992,9217,10452,10147,10932,9729,10067,10557,11002,102
62,11476,11213,11952,9442,10430,10696,11258,10844,11595,11451,12207,10658,11344,11765,12438,11638,1208
7,12546,13453,7183,7648,7899,8868,8309,9339,8774,9878,8159,9046,9006,10110,9258,10290,10042,11080,8532,
9600,9192,10005,9742,10187,10568,10989,9530,10466,10684,11224,10387,11356,11579,12197,8711,9388,9914,1
0338,9669,10718,10517,11329,9794,10581,10818,11850,11042,11455,11484,12396,10137,10958,11173,11571,108
94,11963,11689,12336,10731,11742,12066,12763,11928,12491,12720,13915,9093,9861,10022,10941,10349,10680,
11162,11605,10220,10808,11013,11714,11307,12040,11871,12573,10540,11112,11333,11985,11461,11791,12182,
12885,11499,12287,12097,12671,12349,12844,12984,14202,10856,11367,11616,12174,11734,12219,12467,12773,
11905,12458,12328,13102,12617,13110,12946,13772,12062,12565,12741,13201,12865,13247,13361,13579,13004,
13381,13490,13685,13597,14587,14031,14126,1303,1618,1681,2125,1760,2140,2309,2776,1856,2249,2383,2883,2
543,3020,3085,3868,1978,2326,2424,3014,2635,3133,3343,3913,2738,3335,3228,4018,3537,4129,4227,4951,2051,
2550,2689,3209,2755,3325,3435,4043,2928,3487,3565,4142,3784,4331,4418,5133,3039,3608,3848,4385,3905,449
1,4588,5240,4012,4611,4726,5461,4801,5562,5723,6542,2215,2567,2843,3467,2954,3556,3763,4262,3107,3859,36
33,4422,3985,4531,4683,5317,3270,3836,3995,4606,4094,4703,4776,5503,4199,4821,4974,5638,5121,5776,5927,6
794,3464,4022,4152,4754,4340,4872,5051,5762,4464,5064,5235,5864,5328,6029,6149,6994,4637,5304,5479,6078,
5525,6154,6312,7164,5690,6375,6490,7286,6613,7417,7630,8607,2466,2836,2973,3806,3172,3888,3934,4680,335
9,3986,4104,4744,4207,4861,4920,5745,3530,4115,4238,4882,4396,5042,5206,5892,4521,5208,5314,5990,5490,61
30,6282,7108,3660,4310,4474,5112,4544,5217,5356,6094,4731,5472,5536,6173,5685,6364,6444,7284,4894,5612,5
765,6400,5873,6585,6629,7405,6044,6715,6914,7567,7054,7724,8030,8614,3743,4499,4693,5380,4848,5514,5662,
6388,4963,5700,5799,6530,5929,6623,6785,7522,5184,5898,5992,6704,6159,6863,7019,7780,6258,7071,7203,791
3,7328,8085,8197,9076,5349,6104,6230,6938,6411,7101,7228,7984,6610,7271,7411,8142,7579,8220,8480,9333,67
66,7457,7633,8357,7700,8558,8661,9529,8008,8732,8839,9491,8969,9688,9938,10777,2651,3115,3220,4086,3368,
4125,4273,5037,3388,4283,4432,5145,4566,5326,5390,6271,3640,4444,4577,5439,4714,5485,5598,6275,4810,559
6,5734,6478,5902,6599,6662,7402,3710,4692,4832,5450,5001,5620,5775,6586,5094,5840,5939,6676,6024,6843,69
62,7681,5074,6002,6117,6838,6256,7029,7119,7914,6422,7240,7338,8083,7446,8172,8385,9267,3878,4942,5002,5
818,5171,5977,6107,6797,5244,6144,6205,7006,6324,7153,7259,8072,5713,6286,6414,7192,6544,7313,7443,8154,
6731,7487,7656,8342,7793,8547,8681,9465,5968,6506,6686,7386,6833,7565,7670,8492,6976,7754,7835,8599,803
6,8786,8881,9633,7214,8021,8096,8841,8157,8975,8807,9752,8424,9235,9335,9987,9368,10287,10437,10943,397
4,5156,5194,6245,5626,6359,6441,7229,5827,6467,6554,7362,6729,7500,7646,8503,5944,6710,6820,7511,6927,76
75,7805,8627,7072,7849,7981,8759,8144,8866,9065,9790,6268,6848,6952,7803,7112,7943,8114,8814,7352,8117,8
207,9041,8425,8958,9291,10018,7552,8303,8527,9239,8636,9362,9479,10186,8789,9502,9500,10396,9765,10490,
10615,11301,6496,7059,7242,8122,7497,8218,8380,9120,7658,8494,8569,9344,8718,9398,9495,10269,7810,8651,
8825,9467,8907,9518,9776,10500,9108,9808,9926,10641,10104,10820,10928,11649,8073,8852,9012,9781,9280,97
96,10062,10703,9323,10038,10208,10889,10351,11037,11241,11922,9409,10300,10473,11098,10577,11268,11170,
12006,10766,11404,11504,12251,11694,12379,12552,12979,2864,3248,3444,4174,3588,4453,4579,5361,3701,461
5,4720,5436,4844,5584,5609,6571,3734,4834,4929,5572,5013,5980,6054,6759,5267,6066,6244,6980,6336,7127,72
52,8130,3755,4989,5161,6019,5291,6233,6293,7095,5366,6386,6453,7274,6580,7418,7541,8232,5475,6519,6652,7
468,6807,7644,7726,8448,6874,7685,7860,8649,7901,8748,8854,9964,4318,5278,5338,6326,5449,6455,6574,7375,
5649,6665,6742,7595,6897,7768,7846,8516,5812,6755,6950,7712,7084,7895,7926,8692,7186,7938,7970,8876,829
2,8977,9202,10029,5954,7082,7141,7962,7310,8102,8128,8931,7433,8290,8396,9107,8583,9268,9346,10219,7591,
8474,8638,9358,8795,9455,9650,10363,9002,9676,9819,10502,9933,10653,10851,11620,4361,5412,5586,6638,578
8,6744,6924,7791,5915,6965,7097,7940,7216,7996,8047,8918,6141,7151,7299,8061,7431,8265,8367,9090,7580,84
36,8571,9316,8695,9411,9579,10233,6300,7373,7536,8392,7737,8531,8521,9424,7816,8655,8742,9532,8943,9659,
9716,10523,7994,8797,8990,9690,9095,9845,9937,10712,9228,10004,10142,10890,10385,11060,11254,11948,642
9,7621,7762,8663,7924,8784,8948,9678,8258,9000,9136,9908,9158,9953,10093,10804,8308,9146,9223,10055,943
9,10133,10319,11026,9620,10373,10465,11109,10611,11328,11422,12034,8438,9489,9555,10245,9741,10401,104
88,11209,9821,10600,10726,11391,10855,11521,11672,12283,10158,10737,10903,11544,11089,11721,11800,1250 8,11220,11882,11996,12603,12139,12780,12943,135 26,4556,5651,5851,6970,6119,7138,7279,8167,6184, 7322,746 2,8279,7602,8411,8625,9584,6399,7547,7782,8505,7 871,8773,8706,9631,7950,8828,8964,9806,9122,9873 ,9975,10 768,6809,7820,7952,8760,8252,8929,9017,9921,8277 ,9134,9189,9977,9278,10094,10182,10966,8314,9255 ,9387,1 0171,9610,10310,10449,11124,9701,10563,10606,11 352,10730,11424,11581,12223,6885,8247,8264,9102, 8332,91 48,9309,10118,8467,9448,9544,10275,9665,10426,10 587,11282,8988,9596,9751,10459,9832,10643,10742, 11412,1 0106,10756,10914,11554,11096,11699,11786,12500, 9176,9843,10051,10651,10160,10878,10984,11611,1 0337,110 50,11147,11776,11270,11891,12026,12677,10479,11 233,11375,11991,11498,12105,12214,12803,11637,1 2263,123 70,12924,12433,13120,13147,13863,6940,8345,8409, 9568,8919,9644,9711,10552,9051,9801,9898,10679,1 0081,10 790,10954,11591,9211,9966,10149,10830,10259,110 01,11157,11754,10435,11260,11137,11845,11414,12 017,1213 7,12707,9622,10191,10308,11065,10514,11180,1136 1,11971,10631,11380,11494,12109,11567,12149,122 96,12904, 10861,11530,11662,12240,11809,12393,12477,13051 ,11913,12584,12658,13210,12787,13302,13330,1371 8,9834,1 0321,10617,11385,10779,11472,11532,12193,10937, 11685,11729,12348,11857,12401,12611,13140,10975 ,11836,1 1978,12575,12130,12681,12699,13322,12271,12812, 12880,13396,13023,13544,13633,14078,11293,12083 ,12113,1 2759,12323,12822,12931,13433,12425,13045,13072, 13614,13234,13638,13881,14231,12532,13189,13284 ,13761,1 3417,13802,13946,14357,13485,13981,14063,14461, 14157,14546,14614,14947,4667,4370,3688,5909,425 8,5747,5 105,7224,4506,5128,5300,6899,5422,6371,6179,7560 ,4867,5397,5569,6240,5757,6697,6461,7965,6037,65 56,6779, 7413,7000,8271,7744,8904,4984,5632,5782,6592,606 1,6723,7036,7640,6190,7159,6869,8609,7359,7830,8 014,995 7,6343,7066,7481,7897,7266,8124,8462,9430,7605,8 404,8260,9035,8687,9591,9161,10720,5251,5963,608 9,6934,6 306,7122,7398,8056,6527,7709,7170,8204,7549,8317 ,8555,9221,6712,7347,7882,8451,7750,8871,8393,93 28,7519, 8577,8971,9485,8767,10111,9683,11398,6880,7866,7 615,8724,8228,8620,9077,9552,8002,9260,8835,9858 ,9026,9 738,10559,10281,8352,9114,9298,10214,9425,9909,1 0023,10815,9561,10379,10130,11237,10507,11803,1 1031,12 482,5509,6216,6435,7292,6647,7451,7706,8487,6856 ,8068,7573,8589,7840,8712,8939,9778,7013,7739,82 33,8755, 7976,9196,8846,9706,8326,9048,9393,9934,9273,100 73,10333,10907,7199,8162,7908,8955,8565,9127,941 7,9999, 8456,9606,9208,10598,9537,10201,10238,11141,872 9,9379,9802,10328,9672,10422,10686,11896,9989,10 762,105 34,11203,10948,11436,11576,12632, 7 424,8284,8645,9318,8420,9436,9726,10370,8809,988 0,9539, 10873, 10035, 10 461,10669,11348,8982,9646,10076,10570,10270,107 47,11120,11488,9813,11009,10786,11750,11226,116 45,12001, 12866,9140,10154,10356,11043,9904,10895,11165,1 2079,10484,11323,11458,11783,10938,12255,11923, 13726,10 612,11395,11550,12199,11656,12021,12143,13107,1 1252,12355,12441,12756,12548,13441,12937,14492, 5885,656 7,6749,7719,7041,8098,7854,8901,7132,7934,8539,9 072,8244,9247,9395,10124,7387,8364,8135,9304,855 2,9695,9 166,10263,8780,9450,9772,10397,9565,10801,10647, 11866,7585,8595,8417,9960,9007,9420,9580,10432,8 715,965 6,9838,11071,10046,10547,10750,11505,9103,10120, 9919,10871,10358,10700,11093,11633,10228,11007, 11191,11 717,11345,11938,12230,12735,7775,9285,8676,9748, 8859,10177,9868,10897,9171,9994,10296,10772,104 19,1103 8,11215,11810,9473,10573,10241,11445,10099,1108 2,11181,12160,10760,11318,11525,11954,11643,120 69,12376, 13177,9640,10637,10408,11243,10846,11408,11725, 12319,11054,11840,11469,12188,11564,12597,12462 ,13069,1 0495,11683,12020,12527,11887,12402,12839,13037, 12114,12767,12634,13373,12994,13270,13550,14574 ,8109,89 45,9353,10114,9549,10256,10674,11275,9735,10920, 10343,11386,10537,11154,11654,12310,9236,10455, 10622,11 556,10886,11943,11456,12246,11152,11761,11861,1 2556,11313,12807,12448,13870,9970,10713,11033,1 2056,112 88,11794,11704,12727,10836,11906,12208,12503,12 099,12612,12918,13290,11536,12168,12010,12662,1 2312,131 26,12835,13413,12463,12951,13193,13610,13076,13 512,13952,14227,10144,11085,11369,11898,10925,1 2353,120

30,12754,11621,12067,12538,12890,12201,12987,13221,13697,11205,12410,12277,13018,12580,13281,13093,136
62,12788,13154,13465,13581,13366,14059,13907,14394,11771,12685,12488,13261,12909,13743,13166,13843,123
63,13473,13334,13935,13391,14009,14152,15111,12644,13713,13617,14252,13538,14103,14323,14663,13823,142
89,14212,14803,14436,15344,14714,15534,6425,6909,7255,8191,7533,8297,8542,9405,7693,8888,8430,9787,8700,
9524,9944,10664,7877,8584,9087,9603,8820,10251,9759,10796,9250,10089,10411,11431,10013,10910,11061,119
64,8043,9060,8914,9895,9293,10063,10368,11129,9616,10583,10203,10970,10518,11229,11599,12179,9461,1044
3,10304,11198,10697,11513,11358,12089,10884,11560,11759,12933,11822,12494,12374,13257,8377,9130,9573,10
246,9892,10383,11019,11311,9382,10470,10738,11440,10542,11695,11478,12281,9828,10825,10916,11934,10625,
11597,11853,12536,11265,11980,11678,12421,12155,12642,12826,13511,10226,10997,11363,11781,11163,12058,
11956,12722,11527,12339,12190,12619,11932,12849,12968,13445,11115,12387,12267,12895,12560,13159,13052,
13670,12124,13027,13238,14033,13357,13903,13798,14516,8744,9947,9513,10688,9723,11337,10589,11830,1029
3,10792,11142,11792,11048,11668,12047,12737,10216,11538,11194,12224,10992,11975,11917,12859,11467,1213
4,12429,12654,12333,12999,13116,13626,10509,11297,11628,12077,11745,12519,12292,13185,11325,12244,1269
3,13061,12413,12959,13326,13749,11832,12624,12517,13134,12868,13481,13249,13851,12816,13352,13648,1392
8,13535,14073,14137,14846,10862,11875,11482,12484,11666,12364,12667,13271,11967,12975,12598,13214,1276
5,13384,13467,13962,12122,12900,12731,13521,13133,13428,13704,14376,13029,13815,13557,14051,13750,1419
5,14308,14643,12273,12746,13168,13619,12967,13677,13836,14163,13348,14003,13736,14273,13934,14340,1445
1,14773,13263,13853,14010,14580,14144,14408,14486,14977,13783,14535,14681,14913,14738,15034,15188,1562
0,9263,10087,9863,11174,10390,11335,11074,12042,10549,10962,11674,12529,11515,12164,12381,13034,10709,
11586,11418,12235,11908,12831,12344,13148,11819,12453,12627,13382,12745,13243,13565,14023,11021,11945,
11770,12492,12094,12590,12652,13279,11606,12711,12917,13571,13086,13499,13437,14097,12257,12928,13175,
13420,13039,13655,13758,14242,12857,13827,13627,14176,13920,14347,14427,14861,11286,11707,12301,12907,
12051,12798,13143,13592,12509,13309,13008,13504,12473,13705,13791,14267,12607,13097,13197,14043,13343,
13741,13884,14610,13474,13989,13828,14335,14122,14413,14562,14938,12774,13230,13602,13891,13375,14182,
13992,14464,13721,13942,14247,14506,14066,14768,14626,15016,13530,14171,14328,14648,14414,14829,14752,
15140,14301,14698,14918,15247,14853,15082,15298,15681,11787,12178,12385,13124,12703,13458,13059,13820,
12588,13254,13222,13969,13404,14083,13926,14551,12875,13639,13356,13899,13731,14017,14253,14498,13588,
14189,14320,14631,14143,14704,14820,15135,13009,13493,13845,14111,13681,14342,14220,14688,13765,14260,
14397,14961,14529,14756,14772,15227,13985,14479,14603,14814,14444,15021,14877,15201,14348,14906,15073,
15397,15002,15274,15377,15853,13288,13806,13912,14470,14118,14316,14596,14835,14039,14390,14512,14891,
14675,15057,14972,15310,14234,14567,14692,15030,14758,14932,15127,15449,14779,15174,15086,15354,15207,
15430,15492,15951,14421,14709,14841,15122,14901,15145,15262,15401,14991,15258,15197,15542,15331,15545,
15473,15802,15069,15306,15386,15581,15442,15602,15646,15732,15501,15656,15697,15771,15738,16070,15895,
15926,313,432,457,645,488,651,727,953,530,702,763,1006,838,1077,1109,1542,581,737,781,1073,882,1136,1248,
1569,934,1243,1186,1627,1353,1695,1752,2207,612,841,910,1176,941,1238,1297,1645,1029,1326,1367,1702,1492,
1816,1867,2324,1085,1392,1530,1848,1563,1913,1975,2394,1625,1989,2063,2547,2110,2618,2728,3322,686,849,
986,1314,1039,1362,1482,1773,1121,1537,1406,1871,1610,1939,2036,2449,1209,1522,1615,1986,1674,2048,2094,
2577,1735,2123,2220,2670,2317,2766,2871,3515,1310,1631,1708,2082,1821,2156,2272,2756,1897,2280,2391,282
6,2457,2946,3031,3672,2007,2441,2560,2979,2592,3035,3153,3803,2706,3198,3286,3901,3375,4007,4182,5020,80
2,982,1052,1506,1156,1554,1580,2035,1256,1611,16
79,2075,1740,2149,2188,2744,1349,1685,1757,2163,
1854,226
5,2373,2845,1932,2374,2448,2916,2568,3017,3129,3
759,1422,1803,1904,2310,1947,2380,2476,2992,2067
,2555,26
00,3049,2702,3190,3250,3899,2171,2652,2757,3217,
2833,3354,3389,3998,2955,3455,3609,4128,3716,425
9,4517,5
025,1470,1919,2043,2492,2141,2585,2686,3208,2212
,2713,2781,3314,2872,3384,3508,4091,2360,2848,29
18,3446,
3040,3567,3690,4304,3113,3729,3835,4416,3935,456
4,4658,5445,2471,2999,3093,3627,3224,3756,3854,4
477,337
4,3889,4002,4612,4137,4679,4905,5683,3493,4039,4
184,4797,4240,4975,5070,5874,4496,5131,5229,5836
,5345,60
25,6272,7133,891,1125,1182,1669,1261,1691,1780,2
261,1272,1787,1877,2332,1962,2455,2499,3122,1411
,1885,19
69,2532,2055,2563,2642,3126,2116,2640,2735,3276,
2853,3365,3415,3996,1451,2041,2130,2540,2239,265
7,2764,3
356,2300,2812,2879,3424,2942,3552,3646,4223,2286
,2925,3008,3548,3112,3698,3771,4419,3235,3864,39
42,4561,
4030,4638,4823,5621,1548,2201,2240,2795,2350,290
9,3001,3517,2398,3027,3074,3680,3161,3795,3880,4
551,272
1,3134,3229,3827,3324,3921,4028,4622,3466,4064,4
204,4784,4316,4965,5086,5810,2902,3297,3432,3981
,3544,41
26,4215,4914,3656,4284,4353,5014,4522,5180,5268,
5975,3845,4508,4573,5231,4624,5350,5202,6090,485
6,5591,5
686,6320,5719,6624,6780,7311,1604,2340,2366,3104
,2662,3186,3249,3856,2802,3267,3331,3962,3465,40
73,4195,
4925,2884,3450,3534,4082,3618,4219,4327,5038,373
1,4363,4475,5154,4613,5254,5435,6127,3120,3557,3
638,432
5,3764,4445,4589,5209,3954,4591,4666,5413,4858,5
335,5645,6348,4116,4750,4947,5597,5046,5714,5824
,6520,51
85,5849,5846,6737,6102,6834,6963,7707,3290,3721,
3866,4596,4071,4676,4819,5486,4205,4916,4985,569
5,5118,5
746,5841,6605,4332,5060,5218,5813,5290,5865,6113
,6844,5476,6145,6259,6988,6436,7175,7296,8099,45
53,5241,
5386,6120,5636,6132,6394,7055,5674,6370,6545,725
3,6688,7412,7639,8418,5758,6635,6818,7482,6922,7
668,756
3,8517,7120,7818,7932,8810,8150,8970,9184,9736,9
97,1195,1301,1720,1381,1891,1970,2480,1445,1993,
2060,253
0,2136,2633,2647,3344,1465,2131,2194,2625,2246,2
910,2963,3488,2414,2970,3102,3661,3169,3776,3874
,4602,14
77,2231,2344,2938,2431,3095,3140,3749,2484,3206,
3257,3891,3349,4009,4106,4688,2556,3307,3408,405
0,3524,4
193,4261,4878,3576,4228,4373,5058,4408,5146,5242
,6294,1809,2421,2463,3162,2538,3259,3346,3973,26
78,3416,
3474,4153,3595,4294,4362,4938,2791,3483,3637,424
9,3741,4403,4429,5095,3823,4438,4466,5263,4740,5
352,555
8,6360,2890,3739,3786,4460,3920,4580,4600,5312,4
020,4738,4833,5473,4997,5623,5697,6555,4148,4901
,5048,57
09,5189,5800,5993,6700,5376,6013,6155,6846,6263,
7004,7212,8066,1832,2513,2634,3396,2773,3476,361
6,4314,2
862,3648,3751,4440,3847,4487,4530,5298,3026,3793
,3910,4543,4019,4717,4807,5458,4139,4868,4988,56
70,5097,
5761,5922,6570,3145,3970,4102,4827,4269,4952,494
3,5771,4336,5065,5140,5876,5322,6000,6055,6870,4
485,519
2,5364,6027,5463,6182,6269,7065,5587,6337,6474,7
256,6727,7438,7654,8449,3240,4175,4289,5072,4427
,5178,53
29,6015,4709,5374,5499,6239,5521,6284,6423,7162,
4755,5510,5582,6389,5785,6464,6657,7401,5961,671
1,6810,7
495,6958,7738,7841,8553,4870,5834,5899,6581,6079
,6743,6831,7603,6157,6947,7079,7806,7217,7953,81
23,8850,
6488,7090,7269,7979,7469,8179,8274,9128,7616,836
9,8506,9251,8677,9474,9686,10474,1956,2679,2818,
3652,30
10,3785,3895,4633,3057,3930,4044,4729,4159,4847,
5035,5928,3215,4110,4306,4927,4382,5168,5108,597
2,4449,5
220,5340,6142,5488,6206,6307,7123,3526,4341,4451
,5157,4705,5309,5391,6253,4727,5497,5547,6310,56
33,6426,
6515,7335,4762,5611,5736,6503,5951,6648,6792,751
2,6040,6910,6953,7763,7085,7844,8019,8778,3585,4
700,471
5,5467,4777,5512,5663,6449,4895,5794,5888,6611,6
004,6767,6933,7683,5362,5940,6087,6803,6167,6990
,7098,78
28,6439,7110,7280,7990,7479,8155,8259,9117,5537,
6180,6384,7001,6491,7243,7357,8057,6677,7428,753
7,8248,7
671,8381,8543,9342,6822,7628,7788,8501,7927,8633
,8768,9503,8086,8823,8959,9660,9036,9922,9958,10
961,362
9,4786,4845,5913,5301,5986,6050,6898,5421,6137,6
229,7030,6413,7147,7323,8031,5568,6296,6479,7187
,6596,73
76,7548,8221,6777,7659,7524,8327,7831,8529,8674,9383,5964,6525,6645,7444,6859,7574,7774,8475,6978,7794,7921,8639,8006,8690,8864,9634,7222,7963,8112,8798,8285,8985,9091,9827,8407,9224,9317,10040,9484,10167,10204,10751,6169,6660,6966,7799,7136,7896,7966,8743,7306,8139,8192,8932,8340,8996,9261,9948,7348,8315,8486,9213,8664,9347,9370,10193,8834,9514,9604,10294,9791,10498,10626,11278,7696,8608,8644,9449,8902,9527,9671,10346,9024,9816,9856,10601,10077,10636,10986,11516,9159,10012,10143,10814,10322,10874,11083,11716,10420,11132,11255,11877,11399,12013,12125,12695,2026,1837,1436,2857,1769,2745,2305,3851,1922,2320,2437,3596,2520,3194,3053,4120,2152,2502,2622,3099,2750,3440,3263,4461,2950,3332,3503,4004,3676,4721,4274,5287,2226,2665,2769,3360,2966,3459,3702,4190,3061,3799,3571,5022,3958,4349,4501,6289,3173,3725,4060,4405,3883,4597,4889,5777,4160,4839,4711,5408,5090,5934,5522,7074,2402,2898,2987,3624,3149,3772,3990,4538,3311,4246,3808,4662,4112,4763,4971,5579,3452,3950,4392,4879,4278,5259,4829,5680,4087,4992,5346,5831,5163,6445,6020,7814,3580,4377,4169,5123,4684,5031,5446,5895,4492,5615,5226,6192,5399,6075,6904,6618,4792,5480,5653,6549,5772,6241,6354,7172,5904,6718,6462,7635,6851,8281,7406,9097,2581,3081,3243,3906,3404,4035,4244,4911,3561,4547,4132,5003,4357,5113,5318,6114,3684,4270,4689,5150,4470,5553,5236,6046,4772,5417,5740,6265,5627,6406,6672,7275,3831,4629,4412,5333,4979,5493,5766,6332,4885,5948,5563,6944,5881,6538,6575,7529,5129,5730,6138,6667,6010,6763,7037,8387,6321,7116,6881,7597,7318,7856,8016,9286,4013,4734,5055,5671,4853,5783,6064,6707,5203,6212,5883,7237,6365,6804,7021,7758,5357,5987,6408,6916,6607,7103,7507,7916,6150,7383,7144,8216,7623,8093,8512,9586,5505,6485,6693,7419,6234,7261,7558,8603,6828,7732,7880,8255,7307,8816,8421,10763,6959,7812,7987,8750,8106,8537,8683,9905,7651,8940,9045,9445,9180,10359,9679,11930,2839,3338,3479,4253,3706,4574,4366,5285,3780,4435,4959,5440,4698,5604,5742,6457,3982,4802,4607,5657,4969,6032,5528,6602,5174,5796,6108,6739,5910,7160,6996,8353,4143,5008,4851,6290,5382,5768,5924,6773,5115,5998,6175,7452,6379,6892,7105,7935,5469,6450,6250,7235,6695,7050,7476,8080,6564,7381,7586,8176,7756,8440,8788,9418,4300,5641,5082,6083,5246,6510,6201,7263,5532,6328,6632,7128,6761,7414,7610,8287,5820,6918,6577,7867,6430,7464,7576,8702,7115,7728,7958,8457,8091,8592,8966,9997,5982,6985,6750,7641,7207,7825,8186,8896,7435,8322,7891,8737,8003,9242,9070,9853,6839,8136,8534,9154,8375,8997,9550,9809,8646,9459,9288,10264,9754,10125,10510,12065,4583,5323,5704,6446,5893,6593,7025,7677,6073,7288,6682,7800,6883,7544,8104,8883,5593,6799,6972,7991,7249,8443,7878,8804,7542,8229,8347,9191,7722,9509,9055,10971,6302,7067,7408,8578,7691,8269,8163,9407,7194,8399,8762,9124,8629,9264,9654,10153,7972,8713,8523,9324,8886,9930,9545,10317,9073,9697,10019,10595,9864,10456,11092,11511,6475,7465,7784,8389,7293,8937,8548,9443,8069,8590,9169,9617,8753,9745,10057,10721,7599,9008,8842,9784,9219,10139,9887,10670,9486,9969,10391,10556,10253,11250,11027,11772,8241,9354,9104,10112,9641,10787,9983,10933,8950,10403,10210,11069,10289,11175,11394,12995,9301,10745,10607,11549,10491,11319,11663,12209,10904,11607,11489,12449,11839,13429,12297,13816,3236,3603,3875,4654,4100,4746,4961,5752,4234,5274,4862,6124,5101,5869,6277,7015,4387,4998,5455,5946,5213,6587,6096,7155,5606,6419,6752,7852,6345,7276,7440,8469,4526,5429,5294,6225,5646,6396,6705,7517,5957,6928,6540,7342,6865,7624,8041,8727,5806,6787,6642,7594,7048,7945,7769,8615,7247,7998,8226,9673,8300,9112,8965,10108,4816,5494,5918,6582,6223,6724,7393,7720,5732,6815,7092,7862,6888,8151,7903,8847,6164,7181,7281,8433,6974,8038,8336,9167,7665,8488,8131,9021,8698,9299,9535,10454,6562,7371,7776,8253,7555,8580,8459,9403,7959,8921,8739,9271,8431,9563,9721,10364,7502,8981,8831,9624,9197,9972,9829,10683,8659,9797,10083,11212,10242,11022,10869,11965,5142,6279,5860,7039,6062,7747,6935,8310,6631,7148,7531,8266,7425,8119,8567,9421,6551,7974,7588,8781,7366,8482,8413,9576,7889,8671,9031,9312,8915,9760,9916,10618,6854,7702,8075,8601,8211,9143,8861,10008,7734,88 03,9364,9841,9010,9707,10199,10797,8311,9275,914
1,9942,9589,10415,10097,10944,9520,10234,10649,1
1057,10
485,11271,11370,12524,7225,8362,7909,9099,8118,8
952,9329,10127,8470,9731,9245,10047,9456,10279,1
0393,11
105,8657,9628,9413,10468,9939,10339,10732,11746,
9798,10893,10519,11238,10799,11463,11639,12176,
8836,94
33,9984,10608,9718,10693,10922,11409,10229,1116
6,10774,11582,11066,11690,11862,12398,10115,109
47,11177,
12073,11382,11795,11919,12750,10847,11998,12241
,12640,12340,12853,13135,14000,5617,6417,6197,75
69,6733,
7745,7454,8563,6894,7332,8125,9155,7947,8708,897
2,9803,7060,8026,7836,8792,8402,9540,8926,9961,8
298,906
1,9282,10276,9431,10090,10532,11199,7395,8445,82
39,9109,8621,9232,9311,10138,8051,9389,9652,1054
3,9877,
10439,10354,11309,8818,9668,9995,10329,9812,106
60,10811,11535,9574,10908,10621,11432,11045,117
00,11827,
12547,7688,8165,8872,9639,8573,9498,9954,10571,9
131,10178,9770,10444,9084,10734,10858,11573,925
6,9893,1
0024,11227,10224,10785,10993,12121,10406,11143,
10911,11680,11346,11804,12043,12682,9469,10071,
10584,11
003,10266,11441,11148,11884,10757,11079,11539,1
1951,11262,12388,12145,12818,10481,11420,11669,
12184,11
806,12495,12361,13048,11629,12268,12649,13250,1
2535,12939,13344,14134,8261,8725,8978,9928,9377,
10381,9
839,10898,9230,10101,10059,11116,10305,11289,11
055,12022,9598,10638,10239,11017,10771,11189,11
551,1193
9,10565,11454,11657,12156,11381,12279,12478,130
40,9773,10429,10934,11332,10698,11691,11501,122
54,10821,
11562,11777,12723,11987,12365,12397,13211,11139
,11909,12110,12470,11852,12827,12577,13163,1170
3,12628,
12919,13540,12795,13298,13500,14527,10150,10880
,11034,11892,11341,11652,12100,12505,11222,1176
8,11961,
12599,12231,12896,12743,13369,11522,12052,12258
,12846,12371,12673,13024,13645,12409,13113,1294
8,13455,
13174,13607,13732,14765,11817,12289,12515,13015
,12620,13058,13276,13547,12775,13268,13155,1383
3,13410,
13840,13694,14405,12916,13363,13519,13917,13628
,13959,14057,14243,13748,14074,14168,14332,1425
8,15080,
14623,14702,1796,2181,2257,2786,2352,2804,3002,3
539,2468,2930,3086,3663,3273,3818,3892,4767,2611
,3022,3
136,3810,3379,3945,4186,4812,3498,4176,4055,4928
,4398,5054,5159,5942,2698,3281,3437,4034,3518,41
64,4286,
4954,3712,4343,4431,5067,4669,5271,5365,6133,383
7,4478,4745,5330,4804,5442,5549,6243,4922,5571,5
699,648
1,5779,6589,6757,7606,2893,3299,3620,4321,3742,4
420,4649,5197,3916,4758,4503,5370,4897,5489,5655
,6330,40
96,4730,4907,5565,5016,5676,5749,6522,5125,5802,
5966,6666,6121,6813,6967,7861,4317,4932,5076,572
5,5280,5
854,6045,6798,5414,6058,6236,6902,6341,7073,7196
,8063,5599,6316,6499,7125,6546,7202,7365,8235,67
20,7434,
7551,8360,7674,8495,8707,9675,3182,3610,3766,469
4,3987,4788,4835,5652,4201,4899,5027,5716,5135,5
843,590
6,6783,4389,5039,5170,5866,5341,6034,6208,6930,5
477,6210,6327,7032,6509,7177,7337,8181,4533,5248
,5425,61
10,5504,6219,6367,7143,5703,6493,6558,7219,6714,
7421,7504,8358,5877,6641,6801,7461,6913,7647,769
0,8484,7
087,7783,7986,8642,8127,8799,9106,9681,4628,5451
,5667,6391,5830,6533,6689,7449,5953,6732,6835,75
93,6969,
7684,7851,8598,6187,6937,7034,7771,7206,7929,808
9,8855,7316,8145,8280,8991,8401,9165,9270,10134,
6361,71
54,7287,8010,7471,8175,8305,9057,7672,8346,8491,
9214,8652,9297,9547,10375,7833,8530,8710,9428,87
75,9623,
9727,10564,9079,9795,9899,10527,10027,10715,109
57,11740,3399,3925,4047,5005,4209,5050,5210,6028
,4230,52
21,5381,6146,5527,6339,6401,7327,4512,5394,5539,
6459,5687,6505,6628,7331,5790,6626,6769,7538,694
1,7660,7
727,8481,4592,5665,5815,6471,5994,6650,6811,7649
,6093,6877,6979,7742,7070,7912,8033,8758,6068,70
44,7166,
7905,7314,8101,8195,8993,7485,8318,8412,9162,852
0,9244,9458,10311,4778,5931,5996,6853,6174,7020,
7157,78
64,6246,7191,7258,8074,7377,8224,8335,9149,6746,
7341,7475,8268,7609,8384,8518,9225,7797,8562,873
3,9412,8
869,9612,9744,10503,7010,7568,7753,8465,7900,864
0,8747,9557,8046,8830,8910,9667,9111,9848,9941,1
0668,82
93,9094,9174,9901,9227,10030,9871,10782,9492,102
84,10377,10999,10412,11284,11427,11894,4884,615
8,6196,7
303,6654,7416,7501,8307,6864,7525,7619,8439,7795
,8575,8722,9569,6984,7779,7885,8587,8000,8752,88

80,9693,
8147,8923,9054,9822,9216,9925,10123,10819,7325,7915,8024,8878,8185,9020,9190,9876,8427,9193,9281,10096,
9494,10017,10335,11029,8628,9371,9594,10288,9702,10405,10516,11188,9852,10541,10538,11388,10795,11475,
11592,12226,7557,8133,8321,9200,8572,9294,9454,10172,8735,9559,9635,10386,9780,10438,10531,11267,8885,9
715,9886,10505,9968,10555,10805,11483,10163,10833,10946,11612,11110,11779,11881,12544,9151,9911,10065,1
0810,10326,10823,11075,11677,10366,11051,11211,11846,11343,11982,12171,12790,10450,11295,11462,12038,1
1559,12194,12108,12864,11730,12317,12414,13082,12582,13198,13351,13728,3642,4074,4296,5098,4455,5403,5
541,6374,4581,5575,5692,6456,5826,6614,6637,7634,4618,5817,5917,6601,6005,7023,7099,7824,6273,7111,7301,
8050,7389,8200,8330,9205,4641,5981,6163,7062,6301,7290,7350,8169,6378,7447,7513,8349,7643,8497,8617,930
7,6495,7582,7716,8545,7873,8720,8802,9516,7941,8761,8935,9713,8980,9811,9913,10976,5258,6285,6350,7379,6
469,7515,7637,8455,6678,7730,7807,8670,7968,8844,8920,9583,6847,7819,8022,8787,8160,8974,9005,9753,8263,
9014,9044,9936,9361,10032,10249,11041,6995,8158,8213,9039,8382,9179,9203,9993,8509,9359,9468,10161,9648,
10313,10388,11221,8665,9542,9704,10400,9859,10493,10682,11355,10054,10704,10841,11485,10951,11626,118
13,12520,5303,6428,6616,7701,6823,7809,7997,8867,6954,8035,8171,9016,8295,9068,9123,9978,7189,8222,8370,
9138,8507,9338,9440,10148,8654,9504,9638,10361,9756,10453,10614,11236,7354,8452,8613,9464,8812,9597,958
8,10463,8891,9720,9805,10567,10002,10692,10744,11507,9066,9862,10043,10717,10152,10867,10955,11686,102
78,11016,11145,11848,11379,12003,12183,12814,7490,8697,8838,9730,9003,9846,10007,10706,9332,10052,1018
5,10929,10206,10968,11099,11766,9376,10194,10274,11068,10478,11136,11314,11974,10654,11365,11453,12050,
11589,12253,12334,12891,9507,10525,10591,11245,10770,11393,11473,12141,10843,11580,11698,12308,11816,1
2427,12562,13111,11159,11708,11860,12447,12028,12605,12680,13311,12151,12752,12855,13399,12982,13553,1
3693,14194,5517,6680,6887,8040,7168,8210,8355,9238,7230,8395,8536,9350,8679,9482,9691,10620,7459,8624,8
857,9571,8947,9836,9768,10665,9027,9889,10021,10831,10174,10892,10987,11732,7875,8895,9030,9824,9326,99
90,10070,10942,9348,10183,10236,10990,10323,11101,11184,11915,9385,10302,10428,11172,10645,11305,11439,
12064,10729,11546,11584,12276,11702,12337,12480,13062,7954,9322,9336,10157,9402,10197,10353,11122,9534,
10487,10580,11273,10695,11416,11568,12206,10041,10633,10780,11448,10852,11614,11713,12324,11113,11723,
11868,12455,12036,12586,12668,13305,10223,10864,11064,11623,11161,11838,11935,12512,11331,11995,12086,
12661,12196,12762,12883,13461,11465,12163,12295,12852,12408,12954,13055,13569,12534,13092,13192,13676,
13245,13850,13871,14482,8012,9415,9480,10605,9980,10677,10740,11534,10107,10828,10919,11651,11091,1175
2,11904,12490,10260,10978,11150,11790,11259,11950,12095,12639,11425,12186,12075,12718,12326,12873,1298
0,13488,10656,11195,11303,12008,11497,12116,12284,12834,11604,12299,12405,12957,12468,12993,13122,1366
0,11823,12434,12555,13074,12687,13209,13287,13785,12783,13380,13444,13924,13559,14006,14029,14360,1085
4,11317,11594,12304,11743,12384,12436,13036,11889,12574,12615,13173,12730,13216,13405,13866,11926,1270
9,12841,13371,12973,13463,13479,14021,13099,13577,13642,14086,13764,14209,14285,14660,12217,12936,1296
2,13537,13151,13587,13682,14117,13236,13779,13804,14272,13949,14290,14496,14789,13332,13906,13991,1439
6,14101,14433,14553,14893,14165,14579,14647,14976,14724,15044,15099,15366,5637,5313,4565,6949,5193,678
4,6103,8302,5460,6129,6311,7969,6440,7430,7227,8635,5850,6410,6598,7298,6793,7764,7521,9040,7081,7620,78
45,8493,8071,9343,8819,9965,5976,6661,6819,7655,7107,7790,8108,8717,7239,8231,7937,9677,8435,8906,9086,1
0973,7397,8141,8557,8976,8341,9201,9528,10469,8680,9476,9334,10092,9750,10628,10207,11693,6255,7005,713
7,8007,7361,8196,8476,9133,7590,8785,8243,9277,8626,9386,9621,10271,7781,8423,8960,9517,8824,9932,9466,1
0372,8594,9643,10028,10522,9831,11118,10711,123

15,7949,8942,8691,9786,9303,9687,10135,10588,9075,10307,
9897,10877,10080,10767,11541,11279,9423,10168,10342,11217,10464,10930,11036,11775,10597,11372,11133,12
167,11491,12684,11977,13291,6529,7270,7496,8366,7711,8526,8783,9554,7923,9145,8648,9655,8917,9775,9998,
10806,8082,8813,9308,9818,9050,10244,9907,10736,9397,10103,10434,10953,10318,11086,11327,11864,8276,92
34,8987,10014,9630,10180,10458,11011,9523,10642,10255,11577,10574,11206,11240,12080,9792,10423,10829,1
1322,10702,11413,11659,12768,11000,11728,11518,12136,11900,12347,12476,13422,8502,9356,9710,10362,9490,
10475,10755,11362,9872,10900,10576,11835,11047,11449,11642,12272,10037,10678,11088,11553,11269,11718,1
2060,12400,10838,11959,11749,12636,12158,12541,12861,13630,10190,11156,11349,11988,10924,11854,12104,1
2932,11471,12248,12369,12666,11890,13087,12792,14366,11590,12313,12452,13042,12551,12879,12988,13838,1
2180,13180,13253,13534,13347,14124,13688,15005,6923,7629,7815,8794,8113,9175,8928,9963,8206,9011,9607,1
0129,9319,10297,10436,11128,8466,9435,9210,10347,9619,10723,10213,11264,9842,10489,10800,11390,10602,1
1763,11619,12739,8660,9661,9488,10974,10061,10460,10616,11421,9777,10689,10860,12014,11059,11529,11720,
12416,10159,11123,10939,11833,11351,11673,12033,12531,11232,11957,12127,12602,12270,12806,13068,13514,
8851,10331,9740,10776,9918,11179,10888,11856,10218,11006,11292,11737,11411,11983,12146,12689,10512,115
55,11242,12357,11106,12024,12118,13002,11727,12243,12431,12819,12539,12923,13196,13895,10673,11610,114
01,12172,11808,12322,12610,13146,12000,12714,12380,13031, 12465, 13393, 13272, 1380 1, 11480, 12571, 12877,133
28,12758,13217,13603,13774,12963,13543,13424,14068,13740,13978,14215,15072,9185,10003,10395,11119,1058
6,11256,11647,12202,10765,11874,11338,12305,11520,12093,12549,13137,10286,11444,11600,12456,11844,1280
9,12367,13079,12091,12647,12734,13355,12239,13574,13260,14487,10983,11687,11979,12911,12213,12676,1259
2,13507,11797,12777,13050,13308,12950,13407,13673,13997,12442,13011,12869,13448,13139,13856,13600,1409
9,13274,13700,13910,14269,13809,14184,14558,14786,11146,12025,12291,12770,11878,13178,12888,13532,1252
2,12921,13339,13650,13044,13735,13936,14344,12138,13224,13105,13760,13377,13988,13826,14310,13560,1387
8,14146,14246,14062,14645,14521,14923,12657,13469,13295,13971,13665,14379,13886,14466,13186,14154,1403
4,14545,14082,14604,14721,15497,13432,14356,14275,14804,14204,14683,14866,15141,14450,14836,14775,1525
3,14957,15672,15181,15820,7486,7980,8331,9266,8610,9367,9609,10446,8770,9950,9499,10816,9762,10561,1096
3,11636,8954,9649,10145,10640,9882,11251,10789,11758,10299,11097,11403,12343,11025,11865,12005,12829,91
19,10117,9974,10915,10336,11077,11360,12070,10650,11563,11208,11921,11503,12159,12499,13022,10499,1143
4,11300,12133,11671,12422,12280,12940,11842,12461,12645,13683,12698,13301,13195,13968,9451,10181,10610,
11246,10913,11376,11968,12237,10425,11459,11710,12352,11524,12583,12390,13108,10850,11785,11869,12802,
11602,12497,12726,13337,12192,12842,12568,13233,12998,13430,13591,14183,11230,11947,12285,12664,12102,
12913,12821,13503,12432,13165,13033,13412,12800,13613,13717,14129,12055,13206,13096,13654,13359,13880,
13786,14319,12971,13767,13953,14625,14054,14518,14430,15022,9807,10965,10551,11661,10753,12262,11569,1
2705,11291,11753,12082,12674,11992,12559,12903,13516,11219,12444,12129,13064,11942,12838,12786,13623,1
2378,12978,13241,13440,13161,13745,13847,14280,11493,12222,12526,12930,12631,13321,13119,13902,12250,1
3078,13475,13794,13226,13707,14026,14384,12706,13416,13319,13862,13632,14161,13961,14472,13582,14049,1
4298,14539,14200,14655,14711,15289,11825,12747,12394,13293,12558,13188,13451,13980,12830,13724,13395,1
3930,13541,14077,14148,14564,12969,13657,13510,14191,13860,14112,14349,14908,13768,14443,14221,14638,1
4386,14761,14854,15125,13100,13525,13887,14276,13715,14326,14460,14729,14046,14599,14372,14822,14543,1
4879,14967,15229,13973,14474,14606,15076,14716,14935,14999,15392,14416,15036,15155,15343,15203,15436,1 5556,15883,10309,11095,10883,12112,11384,12260,12016,12899,11531,11912,12563,13329,12424,13007,13199,13770,11682,12486,12331,13071,12779,13595,13170,13873,12696,13265,13419,14075,13523,13957,14230,14618,11970,12811,12655,13299,12944,13387,13439,13987,12507,13494,13671,14237,13819,14175,14121,14678,13089,13680,13893,14106,13776,14304,14393,14797,13621,14452,14282,14741,14532,14884,14951,15299,12211,12594,13128,13664,12906,13567,13869,14255,13313,14012,13751,14178,13283,14351,14423,14817,13402,13830,13913,14633,14042,14378,14501,15097,14156,14585,14454,14874,14699,14939,15060,15359,13549,13945,14262,14507,14070,14746,14589,14980,14363,14550,14799,15015,14651,15224,15108,15419,14198,14735,14869,15129,14941,15276,15213,15519,14849,15167,15347,15604,15294,15471,15640,15929,12669,13020,13204,13854,13484,14140,13792,14447,13385,13965,13938,14569,14092,14665,14537,15048,13637,14291,14052,14515,14370,14613,14805,15009,14251,14755,14863,15113,14715,15172,15268,15515,13753,14170,14467,14691,14329,14880,14781,15160,14400,14811,14926,15379,15032,15215,15228,15586,14583,14993,15092,15265,14963,15423,15312,15567,14886,15337,15463,15715,15410,15621,15701,16051,13995,14437,14525,14984,14696,14860,15088,15281,14630,14921,15020,15323,15151,15454,15389,15651,14792,15064,15162,15433,15218,15356,15509,15756,15234,15547,15475,15683,15572,15742,15789,16121,14946,15177,15285,15506,15334,15523,15614,15718,15402,15611,15564,15826,15665,15828,15775,16016,15462,15649,15708,15855,15749,15868,15902,15965,15795,15907,15940,15993,15970,16201,16080,16103,2292,2736,2825,3422,2933,3441,3667,4260,3065,3586,3760,4393,3963,4562,4644,5580,3225,3689,3813,4554,4080,4699,4960,5634,4213,4948,4817,5753,5190,5886,5999,6816,3323,3971,4149,4795,4235,4936,5071,5784,4450,5130,5225,5900,5481,6115,6213,7014,4584,5275,5556,6181,5624,6297,6407,7129,5748,6431,6563,7370,6649,7483,7652,8511,3543,3991,4348,5106,4481,5214,5456,6038,4668,5570,5302,6217,5720,6344,6516,7213,4869,5543,5731,6427,5847,6539,6619,7415,5965,6671,6840,7561,7002,7710,7868,8765,5102,5759,5911,6594,6125,6725,6920,7694,6264,6936,7124,7801,7226,7977,8100,8973,6463,7200,7388,8027,7439,8105,8272,9142,7617,8338,8458,9265,8581,9394,9601,10544,3865,4337,4507,5511,4751,5605,5658,6513,4976,5721,5859,6583,5973,6713,6781,7678,5181,5870,6009,6738,6191,6911,7091,7832,6333,7093,7210,7933,7399,8079,8240,9083,5334,6091,6278,6991,6357,7104,7257,8044,6568,7382,7453,8126,7611,8328,8408,9262,6751,7534,7697,8365,7813,8554,8596,9384,7992,8688,8889,9541,9032,9696,9996,10548,5433,6308,6528,7282,6698,7426,7587,8354,6827,7626,7733,8499,7869,8591,8756,9497,7068,7837,7936,8678,8110,8837,8998,9747,8217,9047,9182,9879,9305,10048,10155,10981,7248,8054,8189,8913,8374,9078,9207,9949,8579,9248,9390,10100,9551,10179,10421,11214,8738,9432,9605,10306,9674,10496,10594,11396,9971,10661,10761,11359,10881,11537,11762,12493,4101,4677,4808,5837,4986,5882,6051,6905,5009,6063,6227,7026,6382,7223,7294,8230,5310,6242,6395,7349,6550,7394,7520,8234,6658,7518,7664,8444,7842,8566,8631,9380,5398,6526,6683,7360,6871,7543,7708,8556,6973,7777,7879,8647,7973,8817,8938,9653,6945,7946,8067,8811,8215,9009,9098,9881,8388,9218,9314,10045,9422,10131,10334,11153,5592,6805,6872,7751,7052,7919,8058,8769,7134,8094,8164,8983,8286,9132,9237,10034,7642,8245,8378,9172,8513,9289,9419,10113,8703,9462,9627,10291,9761,10486,10613,11334,7910,8472,8658,9365,8805,9538,9642,10431,8951,9724,9804,10535,10000,10710,10802,11490,9195,9985,10058,10764,10116,10885,10733,11598,10369,11126,11216,11805,11249,12068,12200,12633,5707,7038,7077,8205,7550,8323,8405,9209,7760,8432,8524,9340,8701,9475,9618,10442,7883,8684,8791,9487,8903,9647,9774,10560,9049,9817,9945,10685,10102,10788,10972,11630,8227,8821,8927,9771,9088,9910,10074,10739,9330,10078,10165,10949,10371,10870,11176,11831,9525,10252,10467,11130,10569,11244,11347,11981,10714,11371,11368,12165,11608,12247,12354,12938,8463,9037,9220,10084,9471,10176,10330,11020,9629,10433,10508,11225,10648,11276,11364,12053,9779,10585,10748,11336,10826,11387,11617,

12256,11010,11646,11751,12375,11907,12528,12621,13223,10036,10773,10921,11622,11167,11634,11872,12430,11204,11851,12002,12589,12126,12712,12886,13446,11287,12078,12232,12766,12320,12908,12828,13513,12483,13019,13103,13706,13258,13807,13943,14274,4371,4840,5081,5935,5252,6251,6397,7262,5387,6437,6557,7345,6694,7506,7530,8540,5423,6684,6790,7493,6882,7922,8004,8730,7161,8015,8203,8956,8299,9105,9231,10091,5447,6857,7042,7967,7184,8193,8254,9071,7267,8351,8419,9252,8549,9396,9515,10188,7384,8489,8622,9444,8779,9615,9698,10392,8848,9657,9830,10582,9869,10675,10775,11782,6100,7171,7236,8288,7358,8422,8544,9355,7575,8634,8714,9566,8873,9737,9814,10457,7746,8726,8925,9684,9062,9865,9894,10623,9168,9903,9935,10798,10243,10887,11094,11841,7893,9059,9118,9929,9287,10064,10088,10848,9408,10240,10344,11008,10520,11155,11228,12011,9562,10416,10572,11239,10719,11324,11506,12135,10912,11526,11655,12259,11756,12389,12557,13202,6151,7319,7508,8605,7721,8716,8899,9758,7855,8941,9074,9906,9198,9962,10010,10835,8092,9129,9274,10025,9406,10217,10316,10994,9553,10380,10511,11200,10627,11290,11442,12023,8262,9352,9510,10340,9708,10471,10462,11298,9783,10590,10671,11400,10857,11512,11565,12278,9959,10722,10899,11540,10998,11681,11760,12439,11121,11820,11940,12591,12157,12732,12897,13466,8394,9592,9732,10596,9891,10708,10863,11528,10211,10909,11035,11735,11056,11773,11897,12516,10257,11044,11117,11867,11310,11931,12098,12704,11477,12144,12225,12776,12350,12960,13038,13539,10382,11357,11419,12031,11587,12169,12245,12858,11658,12341,12450,13010,12561,13117,13239,13733,11953,12459,12600,13136,12755,13280,13345,13908,12867,13414,13505,13986,13620,14119,14244,14676,6372,7577,7786,8946,8070,9115,9257,10126,8137,9300,9437,10230,9575,10360,10558,11446,8363,9521,9749,10445,9840,10699,10639,11487,9915,10752,10875,11644,11023,11705,11793,12485,8782,9788,9917,10687,10205,10845,10926,11747,10227,11032,11084,11796,11164,11899,11976,12653,10265,11144,11266,11966,11468,12090,12210,12789,11552,12311,12345,12976,12454,13041,13167,13686,8860,10200,10215,11004,10282,11046,11192,11918,10409,11320,11410,12057,11517,12189,12329,12920,10896,11457,11596,12220,11667,12377,12464,13028,11910,12474,12608,13144,12764,13262,13335,13900,11072,11679,11863,12386,11955,12581,12672,13194,12115,12724,12808,13327,12910,13421,13531,14040,12236,12876,12996,13501,13098,13589,13678,14138,13215,13714,13799,14228,13852,14377,14398,14919,8916,10295,10357,11433,10837,11500,11561,12302,10959,11640,11726,12411,11888,12504,12643,13176,11104,11784,11944,12537,12044,12686,12817,13310,12198,12901,12799,13383,13030,13522,13618,14067,11479,11986,12088,12736,12269,12836,12985,13482,12366,13000,13094,13593,13156,13629,13742,14213,12566,13125,13231,13698,13353,13817,13885,14324,13438,13970,14024,14445,14127,14513,14536,14815,11670,12101,12356,13005,12496,13077,13127,13663,12629,13251,13289,13784,13392,13824,13993,14391,12663,13374,13491,13963,13611,14044,14060,14530,13722,14145,14196,14581,14302,14689,14753,15070,12929,13572,13598,14104,13766,14153,14235,14611,13844,14317,14341,14739,14465,14759,14933,15175,13927,14428,14499,14847,14597,14878,14978,15263,14649,15003,15058,15332,15123,15387,15431,15647,6498,6162,5369,7850,6033,7679,6983,9204,6315,7009,7195,8874,7330,8334,8132,9533,6719,7302,7489,8199,7689,8669,8426,9931,7985,8525,8751,9391,8979,10222,9714,10824,6852,7556,7715,8561,8011,8696,9015,9611,8146,9137,8843,10545,9337,9799,9979,11778,8306,9043,9457,9866,9243,10085,10404,11304,9577,10352,10212,10945,10619,11452,11058,12446,7142,7904,8039,8909,8267,9100,9375,10020,8496,9682,9150,10162,9522,10267,10494,11114,8685,9325,9851,10394,9719,10794,10341,11210,9493,10515,10882,11354,10694,11914,11533,13016,8856,9835,9587,10655,10184,10554,10982,11417,9967,11149,10758,11692,10935,11585,12307,12063,10301,11015,11183,12007,11299,11736,11837,12525,11426,12150,11929,12882,12264,13350,12708,13889,7420,8174,8400,9269,8616,9427,9680,10427,8829,10031,9546,10526,9810,10644,10853,11618,8992,9709,10189,10681,9940,11090,10769,115 58,10277,10956,11272,11757,11160,11883,12111,12604,9178,10122,9875,10868,10504,11028,11294,11815,10399, 11466,11100,12338,11405,11997,12027,12804,10659,11261,11641,12107,11523,12187,12418,13426,11807,12481, 12288,12854,12638,13049,13164,14007,9401,10235,10579,11201,10367,11308,11574,12142,10735,11712,11406,1 2578,11847,12221,12404,12974,10891,11502,11885,12316,12054,12469,12785,13091,11650,12692,12502,13307,1 2872,13220,13509,14186,11040,11949,12131,12717,11731,12595,12825,13570,12242,12956,13067,13333,12630,1 3710,13447,14821,12351,13014,13142,13667,13228,13529,13625,14368,12894,13789,13859,14102,13941,14617,1 4240,15353,7823,8535,8721,9692,9019,10060,9823,10822,9110,9900,10480,10977,10198,11138,11274,11925,936 6,10312,10095,11187,10492,11545,11063,12049,10705,11321,11613,12166,11430,12514,12383,13401,9558,10530, 10365,11780,10918,11296,11443,12195,10646,11510,11676,12742,11859,12298,12471,13104,11005,11920,11744, 12576,12132,12428,12761,13212,12019,12691,12845,13278,12972,13460,13692,14088,9743,11171,10609,11593,1 0781,11973,11701,12596,11067,11812,12076,12489,12185,12713,12863,13354,11342,12318,12029,13057,11903,1 2751,12837,13636,12479,12953,13121,13471,13219,13563,13805,14419,11496,12373,12175,12887,12554,13026,1 3286,13763,12729,13379,13075,13659,13153,13982,13875,14339,12252,13248,13527,13923,13418,13825,14167,1 4313,13599,14110,14008,14565,14284,14489,14695,15408,10069,10859,11235,11916,11415,12041,12407,12915,1 1583,12614,12120,13006,12290,12815,13227,13755,11127,12216,12360,13145,12587,13462,13066,13703,12813,1 3316,13398,13948,12949,14142,13865,14925,11789,12440,12710,13555,12927,13342,13267,14081,12543,13434,1 3675,13905,13586,13994,14225,14505,13131,13644,13518,14028,13757,14382,14164,14594,13876,14250,14432,1 4736,14346,14668,14983,15173,11941,12753,12992,13427,12618,13788,13536,14100,13203,13562,13933,14203,1 3669,14279,14456,14801,12856,13832,13727,14299,13967,14497,14359,14777,14128,14404,14635,14719,14560,1 5055,14953,15288,13324,14048,13892,14483,14218,14833,14411,14904,13795,14640,14541,14971,14578,15024,1 5121,15751,14015,14813,14743,15190,14686,15090,15240,15465,14892,15217,15164,15558,15315,15888,15499,1 5998,8390,8884,9233,10151,9508,10248,10482,11283,9666,10809,10376,11627,10632,11392,11767,12399,9847,1 0521,10991,11464,10743,12037,11603,12511,11140,11895,12177,13047,11828,12606,12733,13478,10006,10967,1 0832,11724,11178,11873,12140,12794,11474,12325,11999,12660,12275,12874,13184,13653,11330,12205,12085,1 2851,12426,13112,12981,13576,12585,13150,13315,14236,13364,13898,13803,14481,10327,11030,11438,12032,1 1722,12154,12700,12947,11263,12229,12460,13054,12294,13259,13081,13730,11665,12533,12609,13456,12362,1 3182,13390,13932,12905,13492,13244,13842,13635,14014,14159,14667,12018,12683,12986,13331,12823,13556,1 3472,14080,13123,13778,13661,13999,13454,14174,14266,14621,12782,13814,13720,14208,13951,14406,14325,1 4784,13608,14306,14469,15039,14556,14950,14876,15367,10672,11769,11383,12419,11572,12966,12330,13370,1 2074,12506,12805,13340,12721,13237,13548,14089,12009,13132,12847,13687,12679,13487,13443,14181,13073,1 3616,13849,14022,13773,14287,14374,14749,12266,12935,13208,13568,13304,13918,13739,14426,12958,13702,1 4056,14333,13834,14257,14534,14838,13372,14001,13916,14389,14188,14646,14476,14910,14150,14552,14766,1 4965,14682,15067,15109,15584,12567,13409,13085,13890,13235,13796,14032,14490,13480,14271,13984,14449,1 4108,14573,14636,14989,13606,14210,14085,14673,14387,14608,14807,15278,14307,14888,14701,15050,14839,1 5153,15231,15452,13723,14095,14412,14744,14264,14788,14899,15128,14549,15019,14827,15205,14969,15250,1 5325,15537,14484,14912,15025,15411,15116,15296,15350,15666,14865,15381,15477,15626,15517,15703,15796,1 6048,11151,11893,11697,12833,12162,12965,12744,13546,12300,12651,13240,13925,13114,13641,13808,14309,1 2435,13172,13035,13695,13436,14160,13781,14399,13362,13868,14005,14571,14094,14471,14708,15033,12701,1 3464,13323,13896,13580,13976,14020,14495,13191,14072,14224,14713,14354,14659,14616,15085,13711,14233,14418,14601,14315,14771,14845,15185,14180,14894,14751,15138,14959,15255,15309,15593,12925,13269,13747,14217,13552,14135,14395,14726,13909,14520,14293,14661,13882,14808,14871,15200,13990,14362,14435,15045,14548,14832,14937,15429,14642,15008,14895,15245,15101,15300,15400,15642,14116,14463,14731,14943,14566,15143,15012,15336,14819,14975,15186,15362,15062,15532,15440,15689,14680,15133,15241,15456,15301,15574,15524,15767,15226,15486,15629,15833,15589,15730,15862,16081,13336,13652,13812,14381,14065,14629,14331,14889,13975,14477,14457,14995,14588,15075,14964,15391,14193,14760,14555,14949,14826,15029,15191,15357,14723,15149,15237,15444,15115,15490,15569,15764,14294,14654,14905,15095,14791,15251,15169,15482,14851,15195,15291,15658,15375,15525,15536,15822,15007,15346,15425,15566,15320,15692,15606,15804,15257,15622,15724,15920,15680,15846,15908,16170,14503,14882,14955,15340,15098,15236,15420,15577,15043,15287,15365,15613,15472,15716,15663,15869,15179,15404,15483,15700,15528,15637,15760,15950,15541,15791,15734,15897,15808,15941,15975,16219,15305,15495,15580,15757,15619,15770,15840,15923,15673,15837,15801,16002,15881,16004,15967,16145,15723,15867,15914,16026,15945,16035,16061,16106,15979,16065,16089,16128,16110,16275,16190,16207,6080,6770,6900,7740,7056,7765,8059,8800,7244,7955,8182,8961,8441,9163,9253,10272,7472,8087,8249,9152,8585,9320,9608,10324,8745,9595,9452,10447,9860,10578,10690,11460,7607,8453,8666,9426,8771,9581,9728,10476,9028,9793,9896,10592,10169,10807,10901,11635,9186,9951,10247,10865,10314,10979,11087,11738,10440,11107,11231,11946,11306,12039,12181,12860,7898,8477,8905,9766,9063,9883,10146,10727,9283,10261,9981,10905,10413,11024,11185,11814,9505,10231,10424,11102,10539,11207,11280,11984,10657,11326,11481,12106,11624,12228,12358,13053,9763,10451,10603,11257,10817,11377,11557,12215,10952,11570,11733,12306,11826,12445,12545,13200,11134,11801,11962,12487,12004,12550,12678,13320,12152,12728,12820,13408,12914,13497,13640,14238,8319,8892,9092,10195,9372,10298,10348,11182,9625,10414,10550,11247,10666,11366,11428,12203,9849,10562,10701,11389,10876,11547,11709,12327,11012,11711,11811,12415,11972,12530,12656,13282,10015,10783,10964,11615,11039,11719,11849,12501,11234,11958,12015,12564,12147,12719,12784,13406,11402,12084,12218,12749,12314,12892,12926,13489,12457,12991,13141,13596,13242,13699,13894,14241,10121,10988,11197,11870,11353,11993,12128,12740,11470,12161,12249,12850,12359,12922,13046,13566,11688,12332,12417,12983,12553,13101,13218,13737,12637,13255,13349,13821,13435,13931,13998,14493,11843,12510,12613,13160,12757,13277,13367,13867,12912,13397,13495,13964,13604,14013,14166,14627,13032,13524,13643,14093,13684,14207,14268,14722,13879,14305,14365,14706,14438,14798,14917,15275,8611,9295,9441,10528,9636,10575,10741,11542,9662,10754,10917,11648,11062,11824,11879,12648,9991,10931,11076,11927,11218,11969,12072,12650,11315,12071,12191,12810,12335,12902,12952,13486,10079,11196,11339,11937,11508,12092,12227,12893,11601,12286,12368,12964,12443,13088,13179,13672,11578,12423,12521,13083,12635,13225,13292,13822,12769,13376,13442,13929,13517,13983,14109,14592,10285,11450,11509,12265,11675,12403,12513,13056,11741,12542,12593,13207,12688,13314,13389,13921,12173,12659,12760,13341,12862,13425,13515,13972,13003,13545,13656,14084,13746,14201,14278,14693,12395,12832,12970,13476,13080,13594,13666,14172,13187,13719,13771,14232,13897,14337,14388,14776,13358,13888,13937,14367,13974,14440,14350,14831,14132,14575,14628,14940,14644,15074,15137,15341,10398,11660,11696,12626,12096,12715,12781,13368,12274,12801,12870,13459,13001,13554,13651,14177,12372,12989,13070,13561,13152,13668,13754,14249,13256,13780,13864,14321,13966,14380,14488,14850,12646,13090,13171,13752,13285,13841,13947,14353,13452,13950,14004,14475,14133,14431,14605,14954,13585,14061,14190,14577,14254,14641,14700,15028,14338,14712,14710,15118,14837,15158,15210,15470,12824,13

246,1337 8,13954,13551,14011,14107,14517,13658,14173,142 14,14632,14297,14658,14707,15065,13756,14263,14 358,1469 4,14403,14718,14842,15161,14511,14858,14911,152 20,14992,15292,15335,15592,13922,14371,14459,14 844,1460 0,14852,14973,15244,14622,14962,15038,15318,151 00,15373,15450,15678,14664,15079,15152,15399,15 194,1545 9,15424,15706,15271,15508,15543,15780,15607,158 16,15864,15974,8933,9477,9739,10629,9923,10940,1 1078,11 855,10066,11111,11223,11924,11350,12059,12081,1 2881,10109,11340,11437,12048,11519,12406,12466, 13025,11 764,12475,12625,13190,12697,13296,13386,13958,1 0136,11495,11664,12437,11788,12616,12665,13273, 11858,12 738,12791,13400,12889,13498,13578,14018,11960,1 2843,12945,13533,13063,13649,13701,14147,13109, 13674,13 787,14261,13813,14314,14373,14929,10793,11774,1 1834,12690,11936,12793,12884,13470,12117,12955, 13012,13 615,13129,13729,13777,14185,12261,13021,13169,1 3691,13266,13810,13831,14283,13338,13837,13858, 14385,14 055,14441,14559,14958,12382,13264,13306,13855,1 3423,13940,13956,14417,13508,14053,14115,14510, 14222,14 593,14634,15042,13612,14162,14256,14639,14343,1 4687,14783,15104,14455,14794,14862,15163,14914, 15225,15 303,15582,10839,11901,12061,12934,12238,13013,1 3149,13744,12346,13181,13275,13839,13360,13874, 13904,14 409,12540,13312,13415,13914,13506,14038,14098,1 4502,13605,14139,14216,14619,14286,14666,14747, 15049,12 670,13468,13575,14113,13708,14192,14187,14671,1 3759,14265,14311,14725,14422,14787,14812,15171, 13872,14 345,14448,14800,14504,14875,14916,15248,14572,1 4948,15010,15319,15114,15383,15455,15688,12772, 13634,13 725,14270,13829,14336,14425,14795,14035,14453,1 4526,14902,14538,14924,14987,15286,14064,14531, 14570,14 970,14679,15006,15087,15370,14769,15107,15148,1 5403,15208,15481,15514,15714,14141,14705,14734, 15053,14 825,15120,15157,15439,14864,15204,15254,15504,1 5304,15549,15599,15790,15017,15259,15324,15557, 15395,15 616,15641,15851,15443,15667,15704,15877,15747,1 5925,15966,16096,11052,12119,12293,13183,12523, 13303,13 403,13979,12572,13431,13528,14047,13622,14125,1 4248,14750,12748,13583,13738,14179,13793,14330, 14292,14 774,13846,14361,14434,14857,14519,14887,14934,1 5272,13065,13762,13848,14322,14030,14415,14462, 14909,14 045,14524,14554,14936,14598,14988,15027,15349,1 4069,14586,14653,15023,14764,15084,15142,15407, 14806,15 189,15206,15489,15256,15516,15570,15772,13118,1 4027,14037,14508,14079,14533,14615,14998,14158, 14684,14 730,15068,14790,15132,15198,15464,14446,14757,1 4830,15146,14868,15221,15261,15511,14994,15267, 15328,15 560,15398,15609,15635,15849,14547,14873,14968,1 5223,15018,15314,15355,15579,15094,15380,15415, 15632,15 460,15669,15712,15898,15154,15447,15498,15702,1 5540,15736,15769,15931,15588,15783,15813,15960, 15832,16 006,16013,16161,13162,14087,14123,14742,14410,1 4780,14810,15184,14480,14855,14898,15235,14982, 15280,15 345,15573,14563,14930,15013,15295,15061,15361,1 5418,15625,15136,15457,15412,15657,15512,15709, 15746,15 905,14770,15031,15083,15385,15168,15427,15493,1 5695,15216,15500,15539,15737,15565,15750,15793, 15955,15 307,15552,15596,15777,15644,15821,15842,15990,1 5676,15872,15893,16027,15927,16049,16054,16133, 14870,15 089,15211,15502,15277,15531,15553,15763,15338,1 5605,15618,15807,15660,15823,15879,16011,15352, 15654,15 698,15870,15744,15899,15903,16052,15785,15933,1 5949,16069,15983,16100,16118,16199,15468,15729, 15739,15 919,15800,15935,15962,16076,15830,15989,15996,1 6113,16032,16119,16163,16223,15859,16023,16045, 16143,16 073,16149,16177,16244,16088,16181,16196,16257,1 6212,16269,16279,16318,11168,10849,10049,12342, 10724,12 204,11609,13365,10995,11631,11798,13130,11911,1 2725,12569,13590,11373,11886,12045,12622,12212, 12977,12 796,13857,12451,12871,13043,13496,13205,14041,1 3712,14402,11492,12103,12233,12898,12472,12997, 13229,13 646,12579,13317,13106,14239,13457,13769,13883,1 4927,12702,13252,13542,13811,13394,13955,14155, 14674,13 624,14120,14036,14473,14281,14754,14540,15252,1 1748,12391,12498,13157,12675,13294,13483,13911, 12848,13 690,13325,14002,13584,14071,14206,14568,12990,1

3449,13800,14149,13716,14383,14114,14624,13564,14219,14439,14703,14327,14996,14796,15507,13115,13790,13631,14300,14016,14245,14494,14733,13877,14590,14364,14881,14468,14824,15187,15071,14090,14514,14609,15040,14672,14903,14956,15290,14737,15110,15004,15448,15165,15643,15371,15843,11989,12601,12778,13411,12941,13520,13689,14169,13095,13919,13601,14226,13775,14295,14420,14843,13213,13709,14019,14318,13861,14557,14369,14809,14076,14478,14656,14915,14595,14979,15093,15326,13346,13977,13818,14429,14211,14522,14669,14945,14151,14763,14561,15202,14727,15035,15051,15413,14303,14650,14856,15091,14793,15131,15238,15670,14942,15270,15176,15437,15342,15520,15568,15886,13502,14050,14259,14620,14131,14677,14818,15106,14352,14890,14728,15313,14960,15147,15232,15488,14442,14782,14981,15192,15066,15264,15406,15538,14859,15364,15279,15624,15445,15591,15705,15946,14528,15014,15102,15376,14900,15321,15422,15728,15156,15479,15527,15634,15339,15781,15679,16135,15209,15505,15559,15765,15595,15711,15748,16003,15453,15810,15834,15918,15863,16078,15964,16262,12321,12878,13017,13696,13232,13939,13782,14401,13300,13835,14197,14491,14025,14582,14657,15001,13477,14096,13960,14612,14205,14802,14542,15063,14334,14685,14840,15119,14740,15284,15222,15662,13609,14229,14130,14928,14458,14670,14748,15134,14296,14785,14872,15388,14966,15182,15266,15544,14509,15000,14907,15311,15103,15243,15396,15587,15047,15363,15432,15615,15487,15685,15774,15912,13734,14602,14277,14828,14375,15026,14885,15322,14544,14944,15078,15273,15130,15374,15441,15645,14697,15193,15052,15522,14990,15393,15428,15753,15269,15478,15550,15690,15590,15726,15815,16021,14778,15219,15124,15451,15302,15510,15617,15799,15382,15655,15530,15761,15563,15875,15838,15995,15159,15603,15710,15857,15668,15824,15939,15987,15740,15922,15887,16063,15977,16041,16101,16273,13944,14424,14637,14997,14732,15059,15233,15461,14823,15330,15096,15503,15178,15417,15594,15797,14576,15144,15212,15561,15317,15686,15526,15779,15416,15628,15661,15865,15476,15932,15835,16162,14931,15249,15372,15721,15467,15639,15610,15910,15297,15674,15768,15850,15735,15880,15959,16047,15554,15755,15707,15894,15798,16008,15938,16072,15839,15968,16024,16112,15997,16094,16178,16222,15011,15394,15496,15671,15333,15809,15713,15917,15583,15725,15861,15952,15766,15976,16029,16129,15438,15825,15787,15982,15871,16044,16000,16124,15928,16015,16083,16107,16062,16195,16168,16247,15631,15900,15845,16039,15957,16139,16018,16157,15811,16085,16055,16175,16068,16186,16211,16333,15890,16132,16114,16227,16099,16203,16237,16284,16153,16232,16220,16301,16254,16353,16292,16365,12771,13138,13388,13996,13573,14058,14199,14662,13679,14392,14136,14848,14288,14720,14920,15230,13797,14223,14500,14762,14355,15056,14834,15283,14584,14986,15126,15518,14952,15327,15384,15693,13901,14485,14407,14897,14607,14974,15105,15409,14767,15196,15037,15351,15170,15446,15576,15759,14690,15139,15081,15435,15242,15546,15491,15731,15316,15562,15627,15963,15650,15848,15814,16038,14105,14523,14745,15054,14896,15112,15368,15474,14652,15150,15260,15521,15180,15608,15533,15788,14867,15293,15329,15684,15214,15575,15659,15860,15458,15699,15601,15829,15752,15889,15936,16093,15046,15360,15494,15633,15421,15722,15691,15909,15551,15805,15762,15882,15682,15942,15972,16079,15405,15819,15784,15953,15866,16017,15991,16125,15743,15984,16033,16191,16060,16167,16148,16266,14312,14922,14717,15239,14816,15485,15199,15652,15077,15282,15414,15638,15378,15598,15719,15913,15041,15555,15434,15773,15358,15696,15677,15944,15529,15745,15831,15892,15803,15978,16005,16116,15166,15469,15585,15727,15623,15856,15792,16022,15480,15778,15901,15994,15827,15969,16053,16140,15653,15884,15854,16010,15947,16087,16036,16159,15934,16058,16122,16173,16098,16198,16208,16307,15308,15664,15535,15844,15597,15812,15896,16042,15694,15973,15876,16028,15921,16067,16084,16179,15741,15954,15911,16095,16009,16075,16130,16245,15985,16151,16102,16194,16141,16218,16234,16282,15 786,15916,16019,16115,15971,16126,16156,16213,16057,16185,16137,16231,16174,16240,16256,16299,16040,16160,16187,16274,16210,16249,16261,16321,16146,16268,16286,16314,16293,16327,16340,16370,14591,14985,14883,15426,15117,15484,15390,15717,15183,15348,15600,15858,15548,15754,15817,15986,15246,15571,15513,15776,15675,15937,15806,16014,15648,15836,15885,16066,15915,16034,16104,16189,15369,15687,15630,15847,15733,15874,15891,16043,15578,15906,15958,16105,15999,16091,16077,16202,15782,15961,16020,16074,15988,16123,16142,16225,15943,16154,16117,16215,16171,16242,16253,16309,15466,15612,15794,15956,15720,15930,16012,16109,15852,16050,15980,16092,15841,16131,16147,16230,15878,16001,16025,16193,16056,16138,16164,16278,16086,16183,16155,16239,16206,16250,16271,16317,15924,16031,16111,16165,16064,16216,16184,16258,16134,16176,16226,16264,16197,16297,16280,16324,16097,16214,16238,16283,16251,16304,16294,16337,16233,16289,16315,16345,16308,16331,16349,16373,15636,15758,15818,16007,15904,16082,15992,16152,15873,16037,16030,16180,16071,16200,16172,16270,15948,16120,16059,16166,16136,16188,16228,16263,16108,16217,16236,16281,16209,16290,16303,16336,15981,16090,16158,16204,16127,16241,16221,16287,16144,16229,16248,16319,16267,16295,16298,16344,16182,16260,16277,16302,16255,16325,16310,16342,16243,16313,16330,16357,16323,16348,16355,16379,16046,16150,16169,16259,16205,16235,16276,16305,16192,16246,16265,16311,16285,16328,16320,16351,16224,16272,16288,16326,16296,16316,16335,16361,16300,16339,16332,16354,16343,16359,16363,16382,16252,16291,16306,16334,16312,16338,16347,16358,16322,16346,16341,16366,16352,16367,16362,16378,16329,16350,16356,16368,16360,16369,16371,16375,16364,16372,16374,16377,16376,16383,16380,16381]

**Sequence group 6: Q6_2048**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1026,520,288,528,192,544,70,44,131,81,50,73,15,320,133,52,23,134,384,76,137,82,56,27,97,39,259,84,138,145,261,29,43,98,515,88,140,30,146,1028,71,262,265,161,576,45,100,640,1025,51,148,46,75,266,273,517,104,162,53,193,1032,152,77,164,768,268,274,518,54,83,57,521,112,1024,135,78,289,194,85,276,522,58,168,139,99,86,60,280,89,290,529,524,196,141,1040,101,147,176,142,530,321,31,200,90,1056,545,292,322,532,263,149,102,105,304,296,1030,163,92,1033,47,267,385,546,324,208,386,150,153,165,106,55,328,1088,536,577,548,1034,113,154,79,269,108,578,224,166,519,552,195,270,1041,641,1036,523,275,580,291,59,169,560,114,277,156,87,1152,197,116,170,61,1042,531,525,642,281,278,526,177,293,388,1057,91,584,769,198,172,120,201,336,62,282,143,1029,1044,103,178,294,93,1058,644,202,592,323,392,297,770,107,180,1280,151,209,284,1027,648,94,204,298,400,608,1089,352,325,533,155,210,305,547,300,109,1048,184,534,1060,537,115,1090,167,225,326,306,772,157,656,329,110,117,212,171,1038,776,1064,330,1153,226,549,1043,538,387,308,216,416,271,279,158,337,550,672,1092,118,332,579,540,1072,389,173,1037,121,553,199,784,179,228,338,312,1536,704,1154,390,174,554,581,1046,393,283,122,448,353,561,1096,203,63,340,394,1049,1281,527,582,556,181,295,1059,285,232,124,205,182,643,1156,562,286,585,299,354,1045,211,401,1104,185,1061,396,344,586,645,1282,593,535,240,1050,206,95,327,564,800,402,356,307,301,417,1160,213,1066,568,1120,832,588,1035,1537,186,646,404,1091,227,896,594,418,302,649,771,360,539,111,1052,331,1168,214,309,1062,1284,188,449,1073,217,408,609,596,551,650,229,159,420,310,1093,541,1288,773,610,657,333,1065,119,1098,600,339,1184,218,368,652,1031,230,391,313,450,542,1538,334,1076,233,555,774,175,123,1155,658,612,341,777,220,314,1105,424,1068,395,673,583,355,1296,1094,287,183,234,1051,125,557,1216,660,616,342,316,1157,241,778,563,1074,345,452,397,403,1112,207,1540,674,558,785,1100,432,1039,357,187,1162,236,664,1312,624,587,780,1080,1122,705,126,242,1063,565,398,346,456,358,405,303,569,1544,244,1158,1097,595,1283,189,566,676,1169,1054,1 108,361,706,589,1344,215,786,647,348,419,406,464,680,801,1069,362,1164,590,409,1286,570,1121,788,1552,1106,597,1075,572,1186,219,311,708,598,1289,601,651,421,792,802,611,1047,602,1172,410,231,688,653,1128,248,1070,369,190,364,1568,654,1095,659,1161,335,480,315,221,370,1285,613,1408,422,425,451,1077,614,543,1298,235,412,343,372,1185,775,317,1539,222,1099,426,453,237,1124,559,1170,1292,833,804,712,1082,834,661,1053,808,779,1217,617,604,1541,433,720,816,1101,1176,836,347,897,1136,243,1297,662,1600,454,318,675,1110,618,1081,898,781,1314,1220,376,428,1546,665,736,567,1107,1192,1078,840,625,238,1159,359,457,399,787,591,678,434,677,1290,1542,349,1300,1102,245,1188,458,666,1113,620,1553,1163,1313,363,127,1067,191,1125,782,407,436,626,1218,571,465,681,246,707,1346,350,1084,599,668,1548,790,1165,1320,460,1123,1200,249,682,1664,573,1171,411,803,1116,789,1304,709,365,440,628,689,374,1224,423,1556,466,793,1130,250,371,1174,481,574,1348,413,1109,603,366,1545,1287,1055,468,1570,655,900,805,615,1166,684,1409,710,1187,429,794,252,1114,373,605,1232,848,690,713,632,1316,482,806,1132,1083,427,1177,904,1569,414,1291,223,1126,1554,663,692,835,1328,619,472,1137,455,796,1189,1601,809,714,1248,721,837,716,1086,1302,1352,864,810,1173,606,1194,912,1103,722,696,377,1424,435,1293,1560,817,1129,1792,319,621,1180,812,484,1345,430,1572,1138,1299,838,667,1219,488,1111,239,378,459,622,1410,627,437,380,1201,1608,818,1178,1294,461,1543,496,669,1190,1317,679,1140,1079,1221,724,841,1305,629,1584,351,467,1360,438,1115,737,251,462,442,441,1666,469,1549,247,683,1196,1226,842,1412,1127,738,1144,1308,899,1602,670,1318,783,1085,849,1555,1193,820,1576,728,928,791,367,1376,901,1233,630,1321,685,844,1204,633,711,1118,253,691,1301,824,1175,902,686,1668,1222,1416,1133,740,1347,850,375,1558,444,1306,470,1167,483,1547,415,485,905,1202,795,473,1240,634,744,1616,852,960,1322,865,693,1131,1794,1350,797,1225,1604,1571,906,1252,715,1141,1330,807,474,636,1179,694,254,1550,1665,717,1071,1315,575,913,1440,798,811,379,1208,1353,1191,697,1564,431,1142,607,1228,489,1324,866,723,486,1573,1181,1234,908,1793,1561,718,813,1364,476,856,1117,1411,839,1329,1295,1146,725,698,1472,914,1249,752,868,819,1349,814,439,929,1197,1578,490,1139,1680,623,1632,1336,671,1198,1362,739,1603,1557,1413,916,1303,463,1236,843,1135,381,1672,1354,497,1586,930,821,726,961,1203,1182,872,1418,492,1250,1332,631,1574,1223,729,1145,1605,700,1796,443,1307,741,1378,1562,1356,1205,845,1319,920,382,1585,822,1425,851,1229,730,1609,498,880,1256,742,445,1392,471,635,1148,1696,932,1580,687,1210,1420,1612,1325,1800,903,1134,825,1235,1361,500,1577,846,1670,1195,745,826,732,1264,446,962,1426,1620,936,1377,475,853,1310,867,637,1551,1230,1414,907,1206,1667,1588,1333,487,1808,695,1441,1087,746,828,753,1610,854,1237,1326,857,1368,1209,504,799,1355,255,964,1242,909,1673,1559,1309,719,1143,477,1617,915,1448,1380,638,748,944,1728,1331,1227,869,1592,1428,491,699,1253,1351,754,1183,1565,858,1618,1417,1476,478,968,1260,383,1212,910,1801,815,1579,976,870,1684,1633,917,1337,1241,1606,1824,727,1150,1442,493,1357,1251,1676,873,1384,701,1566,931,1323,1798,1365,1473,756,1334,860,499,731,1648,1238,823,1575,922,1199,1674,874,1432,1421,918,1636,1254,502,1795,933,1366,1338,1682,1587,1211,1488,743,1358,760,1244,1581,881,1147,494,1379,1272,702,921,1624,501,876,1415,847,1856,1444,992,1697,447,1607,1436,1369,1257,1704,733,1797,1669,1340,1231,827,1590,934,1634,1474,882,937,963,1419,747,1265,1119,505,1381,855,924,1810,734,829,1563,1213,1611,1363,1430,1258,1688,1386,965,1614,1730,1239,938,884,506,1327,1589,1804,749,1370,1640,945,966,1456,1681,755,1266,859,1427,1593,1388,940,1214,830,1809,911,1621,1582,1832,871,639,1480,1698,1335,888,1372,1245,479,1422,1268,946,1732,1677,750,1802,1626,1393,969,508,1613,861,1446,1857,1339,757,1382,970,1700,1243,919,1594,1433,1826,1504,875,1635,1259,862,1920,1675,1445,758,1149,948,1359,1816,1596,1671,1712,977,1385,923,1622,972,1434,1311,1729,761,1396,877,1207,1475,1449,1812,952,1686,495,1262,1644,1619,1341,1429,1825,703,1371,1638,1567,1736,935,1685,978,1625,883,762,1246,503,1458,925,1394,1269,878,1478,735,1799,1

678,1860,1443,1637,1481,1373,1699,1255,993,1591,1828,1452,885,939,994,1400,1744,1656,980,1689,926,764,1270,941,1628,1367,1805,1457,1921,1583,1387,1642,967,1267,1484,1450,886,831,1683,1342,1811,947,1705,1431,507,1261,1840,889,1650,984,1760,1490,1615,751,1702,942,1858,1423,1460,1383,996,1692,1641,1814,971,1477,1273,1512,1733,890,1598,1374,509,1806,1922,1649,949,973,1397,1489,1708,1627,1000,1690,892,1274,1438,1817,1390,1464,1868,950,1151,1731,1506,1827,1597,863,1451,759,1864,1714,1701,1395,1803,1008,1623,1482,1276,510,1435,1652,979,1492,953,1928,1829,1389,1738,763,1872,974,1453,1643,1713,1818,1215,1402,1629,1520,1830,1691,954,1459,1734,879,981,1505,1706,982,1924,927,1833,1639,1447,1746,1343,1679,1820,1761,1479,1275,995,1740,1401,1888,765,956,1496,1861,887,1437,985,1720,997,1630,1813,1462,1398,1645,1848,1687,1247,1716,1936,986,1483,1651,1745,943,1859,1508,1834,1454,891,1841,998,1595,1278,766,1465,1709,1764,1646,1737,511,1485,1404,1693,1866,1952,1491,988,1657,1752,1807,1399,1844,1001,951,1654,1926,1707,1391,1002,1468,1836,1494,1873,1271,1694,893,1923,1461,1748,1715,975,1862,894,1815,1497,1653,1510,1762,1842,1375,1703,1009,1466,1874,955,1739,1486,1930,1889,1004,1658,1821,1718,1929,1599,1507,1776,1405,1735,1831,1493,1010,1984,1455,957,1865,983,1710,958,1514,1876,1768,1721,1938,1660,1500,1403,1892,1819,1741,1516,987,1932,1463,1012,1843,1749,999,1838,1277,1647,1925,1498,1742,1513,1880,1717,1016,1953,1837,1867,1631,1469,1747,767,1904,1724,1524,989,1406,1754,1822,1835,1499,1944,1863,1890,1467,1003,1522,1763,1695,1850,990,1005,1937,1722,1845,1495,1655,1765,1956,1487,1750,1869,1521,959,1896,1263,1940,1770,1877,1509,1711,1756,1846,1011,1960,1784,1870,1662,1013,1985,1753,1927,1528,1849,1882,1766,1511,1954,1719,1777,895,1439,1006,1878,1891,1939,1661,1502,1986,1852,1934,1723,1772,1515,1897,1014,1470,1743,1931,1017,1968,1881,1894,1769,1517,1778,1941,1823,1659,1992,1875,1755,1501,1018,1900,1725,991,1933,1839,1525,1955,1988,1884,1726,1948,1780,1518,1020,1767,1905,1851,1893,1945,1757,1530,1958,1471,1007,2000,1847,1898,1523,1942,1961,1871,1771,1529,1912,1758,1989,1946,1526,1906,1883,1773,1957,1853,1976,1015,1751,1993,1503,1962,1781,1885,1908,2016,1854,1532,1972,1774,1019,1895,1987,1969,1782,1279,1943,1899,1994,1663,1964,1785,1021,1935,1886,2001,1407,1779,1990,1970,1879,1022,1902,1947,1759,1907,1527,1996,1786,1959,2002,1913,1949,2017,1534,1788,1910,1965,2004,1901,1966,1775,2008,1531,1971,1950,1909,1991,2018,1727,1916,1855,1974,1995,2020,1977,1787,1914,2005,1887,1023,1963,1998,1783,2024,1980,1903,1973,2003,1789,1997,2032,1978,1917,2010,1519,2019,2006,1951,1911,2021,2009,1790,2026,1975,2012,1967,1915,2025,2022,1981,1918,2033,1999,2028,1533,2011,1982,2034,1979,2023,2013,2036,2007,2030,2014,2040,1535,2027,2029,2035,2037,1791,2038,2041,1919,2042,2039,2044,2043,2031,1983,2046,2047,2015,2045]

**Sequence group 6: Z6_2048**

[0,1,2,7,3,8,11,24,4,10,13,28,16,33,35,77,5,12,14,32,19,38,47,81,22,46,42,88,57,96,102,166,6,17,21,40,23,45,51,90,29,55,59,97,72,110,116,184,34,61,75,114,80,123,133,195,87,135,146,221,151,232,252,363,9,18,26,54,30,58,71,105,36,76,62,117,84,127,140,204,44,74,86,134,92,143,150,227,100,153,168,244,182,260,277,402,53,89,98,149,111,160,176,257,121,177,194,269,206,291,307,433,137,202,224,297,230,308,331,462,249,339,357,483,376,504,541,725,15,25,31,73,39,79,82,139,48,85,93,148,101,158,163,254,56,94,103,161,115,175,191,272,126,192,203,286,226,304,326,451,64,108,122,181,128,193,209,299,147,222,231,310,248,337,351,482,162,240,258,343,270,371,378,501,293,390,420,530,441,558,614,727,69,124,142,212,157,229,247,341,167,250,263,362,278,377,401,521,189,273,287,387,309,412,437,568,322,444,467,592,489,624,644,819,208,300,316,424,344,450,471,607,375,479,502,636,532,648,700,874,399,512,542,675,553,715,737,915,611,751,773,908,799,951,1005,1192,20,37,41,91,49,95,106,174,50,107,118,185,130,205,213,324,63,119,131,218,144,225,238,325,152,237,253,356,274,374,382,500,67,141,154,220,171,241,259,372,179,267,279,384,290,409,428,55

0,178,288,302,408,321,438,453,593,346,473,490,623,510,642,
680,859,78,165,172,265,188,284,301,403,196,306,314,435,332,460,477,621,251,327,345,465,364,487,509,638,393,
516,546,672,571,712,740,902,283,359,385,497,407,529,548,702,431,564,578,724,615,762,782,939,468,613,625,77
4,639,801,766,965,689,851,875,1016,881,1081,1115,1229,83,186,190,320,242,336,350,472,266,355,365,494,392,5
18,545,704,280,388,406,519,422,549,573,730,445,581,606,756,637,779,817,973,323,410,427,572,452,599,629,768,
492,630,646,813,690,797,865,1022,527,666,708,853,731,880,905,1058,763,911,910,1105,967,1127,1155,1308,358,
442,474,631,517,647,679,829,547,703,717,876,748,887,909,1077,574,735,770,903,786,913,969,1129,827,978,1001,
1161,1040,1201,1226,1385,622,776,809,971,863,974,1030,1174,872,1026,1062,1215,1094,1247,1294,1444,889,10
84,1123,1263,1146,1300,1278,1463,1189,1331,1352,1516,1396,1544,1581,1667,27,43,52,99,60,120,132,210,66,13
6,145,217,156,235,239,368,68,155,164,234,173,285,294,398,198,296,319,432,334,455,475,634,70,170,187,289,200,
317,328,448,211,340,352,480,370,505,524,650,223,360,381,514,404,544,559,694,414,551,583,734,590,754,777,10
11,109,199,207,333,219,353,369,496,245,383,394,536,417,566,580,706,264,397,426,556,447,588,595,742,464,597,
604,781,664,802,845,1024,281,446,458,602,486,627,633,791,508,663,683,826,720,860,877,1065,535,699,732,879,
764,900,943,1097,807,948,980,1130,1002,1165,1206,1378,112,215,236,379,262,395,421,570,276,429,449,598,469,
609,617,788,305,459,485,619,507,658,677,822,533,692,718,870,743,890,927,1068,329,495,523,681,560,709,707,8
93,575,736,752,916,793,945,957,1135,608,765,805,952,823,987,1004,1176,850,1020,1049,1216,1103,1253,1297,1
451,348,540,565,738,594,761,795,949,655,806,834,997,838,1008,1037,1199,667,836,849,1029,897,1048,1088,124
4,936,1100,1121,1264,1153,1314,1336,1470,693,907,922,1071,962,1107,1126,1287,981,1151,1179,1328,1207,1356,
1391,1525,1053,1181,1219,1363,1260,1402,1419,1571,1289,1435,1461,1591,1493,1628,1661,1772,129,246,268,4
30,303,457,481,641,312,488,513,661,537,686,729,929,342,525,569,705,585,759,745,938,600,771,798,977,830,991,
1014,1190,405,576,601,757,654,790,810,1000,660,833,843,1015,862,1038,1057,1233,668,856,884,1055,934,1087,
1117,1267,954,1143,1152,1319,1180,1337,1371,1509,416,653,657,824,671,837,869,1044,698,898,919,1079,946,11
12,1148,1303,804,931,964,1119,983,1162,1183,1333,1041,1186,1222,1365,1262,1398,1415,1569,842,986,1028,116
4,1054,1212,1236,1377,1092,1251,1272,1412,1301,1437,1468,1607,1124,1292,1324,1460,1351,1484,1508,1632,13
82,1519,1541,1656,1556,1693,1700,1831,425,673,685,925,789,941,956,1141,815,975,995,1169,1034,1195,1231,13
73,847,1012,1051,1203,1075,1239,1275,1407,1114,1298,1269,1429,1334,1465,1492,1613,937,1059,1086,1255,113
3,1280,1321,1456,1159,1325,1350,1485,1369,1495,1527,1651,1208,1359,1388,1513,1421,1548,1563,1681,1442,15
86,1604,1712,1629,1732,1736,1804,984,1089,1156,1326,1193,1346,1360,1504,1227,1395,1404,1536,1431,1549,15
93,1698,1235,1427,1458,1584,1490,1608,1611,1734,1521,1634,1647,1749,1674,1776,1791,1867,1306,1480,1486,1
624,1532,1636,1658,1755,1554,1680,1686,1786,1717,1792,1833,1888,1577,1709,1729,1814,1752,1819,1846,1909,
1765,1850,1864,1922,1878,1934,1943,1982,138,113,65,275,104,255,180,470,125,183,201,418,216,338,311,528,15
9,214,233,318,256,386,354,603,292,366,400,503,434,659,562,785,169,243,261,373,295,391,439,543,313,461,413,7
26,493,577,612,1009,335,443,515,589,478,632,697,895,538,684,656,812,741,930,839,1178,197,282,298,423,330,4
54,499,618,361,555,463,645,526,669,714,848,389,491,587,695,563,780,682,873,520,719,800,906,758,1042,950,13
30,415,584,539,749,649,728,820,921,610,857,772,988,811,961,1142,1080,674,828,867,1063,894,998,1023,1200,92
3,1101,1047,1293,1131,1420,1245,1564,228,315,349,484,380,511,554,701,411,620,531,722,579,746,792,970,436,5
61,651,755,605,844,775,955,670,814,885,1003,861,1032,1091,1220,466,640,591,796,716,831,891,1019,696,933,84
6,1150,917,1060,1069,1270,750,882,976,1090,947,1111,1170,1438,1017,1188,1136,1285,1230,1339,1370,1598,506,
662,733,871,688,896,959,1099,767,992,918,1211,1025,1120,1167,1318,803,942,1033,1144,1078,1184,1266,1349, 979,1241,1194,1406,1290,1384,1462,1644,835,1052,1095,1249,996,1217,1277,1479,1125,1312,1343,1414,1228,1517,1445,1806,1154,1329,1364,1505,1387,1467,1494,1691,1296,1538,1557,1623,1580,1757,1660,1927,271,367,396,557,440,626,582,784,456,596,710,818,652,854,886,1046,498,676,635,868,713,953,840,1076,760,899,968,1106,924,1198,1163,1433,534,723,687,1010,808,892,928,1113,747,944,985,1256,1027,1139,1185,1353,825,1045,999,1210,1096,1173,1261,1381,1067,1240,1282,1401,1317,1448,1511,1618,567,864,739,963,778,1056,990,1218,841,1018,1083,1191,1110,1248,1288,1422,904,1145,1070,1341,1039,1258,1281,1497,1187,1311,1357,1452,1383,1477,1543,1707,940,1160,1108,1295,1205,1332,1403,1531,1252,1428,1345,1502,1368,1589,1560,1685,1128,1394,1466,1575,1436,1550,1640,1678,1487,1626,1599,1744,1669,1725,1777,1938,628,794,878,1043,920,1074,1168,1302,960,1224,1093,1327,1137,1274,1386,1529,852,1118,1157,1366,1214,1449,1342,1515,1273,1409,1432,1582,1310,1633,1558,1832,1013,1177,1246,1474,1305,1418,1399,1616,1204,1440,1507,1570,1483,1594,1655,1731,1361,1499,1464,1605,1530,1695,1639,1751,1561,1662,1710,1785,1687,1770,1847,1887,1050,1259,1323,1439,1225,1537,1469,1622,1379,1476,1579,1648,1506,1668,1714,1800,1286,1551,1523,1673,1585,1728,1689,1796,1630,1702,1760,1781,1743,1863,1838,1912,1411,1609,1566,1723,1653,1810,1704,1827,1539,1762,1737,1844,1748,1855,1877,1997,1601,1803,1787,1892,1775,1870,1902,1948,1823,1897,1885,1965,1919,2017,1956,2029,347,419,476,643,522,665,711,888,552,783,691,972,744,914,1006,1166,586,721,821,932,769,1073,966,1197,855,1036,1109,1338,1021,1221,1254,1454,616,816,787,994,866,1031,1098,1268,935,1147,1061,1234,1134,1291,1375,1501,901,1116,1085,1284,1172,1354,1320,1481,1213,1367,1408,1659,1424,1568,1542,1722,678,832,926,1072,993,1102,1242,1309,883,1122,1182,1340,1138,1397,1347,1524,982,1202,1223,1447,1158,1374,1430,1578,1299,1459,1393,1553,1496,1600,1637,1769,1066,1238,1322,1413,1276,1475,1453,1615,1358,1534,1503,1595,1446,1641,1665,1758,1265,1547,1520,1649,1583,1703,1682,1797,1489,1675,1718,1859,1742,1837,1818,1931,753,1007,912,1171,958,1316,1149,1425,1082,1196,1271,1417,1250,1390,1472,1619,1064,1362,1283,1510,1237,1457,1443,1643,1344,1491,1555,1603,1533,1670,1692,1789,1132,1307,1380,1478,1405,1574,1526,1708,1313,1514,1610,1684,1552,1663,1735,1811,1426,1596,1573,1697,1645,1764,1720,1829,1635,1740,1794,1842,1774,1866,1874,1971,1209,1434,1348,1565,1389,1540,1606,1726,1455,1666,1590,1713,1625,1747,1761,1848,1488,1650,1617,1771,1696,1754,1801,1910,1676,1821,1778,1862,1812,1884,1899,1946,1522,1621,1705,1788,1664,1798,1826,1879,1739,1854,1808,1896,1843,1905,1921,1963,1724,1830,1856,1939,1876,1914,1926,1985,1816,1933,1950,1978,1957,1991,2004,2034,858,1035,989,1279,1104,1315,1257,1471,1140,1232,1392,1576,1355,1498,1545,1677,1175,1372,1335,1512,1441,1638,1535,1701,1423,1559,1597,1746,1620,1719,1779,1858,1243,1450,1410,1567,1482,1588,1602,1727,1376,1614,1654,1780,1688,1767,1756,1869,1518,1657,1706,1753,1679,1795,1813,1890,1642,1824,1790,1881,1840,1907,1918,1973,1304,1400,1528,1652,1473,1631,1699,1783,1572,1733,1671,1768,1562,1802,1817,1895,1592,1690,1711,1861,1738,1809,1834,1942,1763,1852,1825,1904,1873,1915,1936,1981,1627,1716,1784,1835,1745,1882,1853,1923,1805,1845,1891,1929,1865,1961,1944,1988,1773,1880,1903,1947,1916,1968,1958,2001,1898,1953,1979,2009,1972,1995,2013,2037,1416,1500,1546,1694,1612,1759,1683,1822,1587,1721,1715,1849,1750,1868,1841,1935,1646,1793,1741,1836,1807,1857,1893,1928,1782,1883,1901,1945,1875,1954,1967,2000,1672,1766,1828,1871,1799,1906,1886,1951,1815,1894,1913,1983,1932,1959,1962,2008,1851,1925,1941,1966,1920,1989,1974,2006,1908,1977,1994,2021,1987,2012,2019,2043,1730,1820,1839,1924,1872,1900,1940,1969,1860,1911,1930,1975,1949,1992,1984,2015,1889,1937,1952,1990,1960,1980,1999,2025,1964,2003,1996,2018,2007,2023,2027,2046,1917,1955,1970,1998,1976,2002,2011,2022,1986,2010,2005,2030,2016,2031,2026,2042,1993,2014,2020,2032,2024,2033,2035,2039,2028,2036,2038,2041,2040,2047,2044,2045]

**Sequence group 6: Q6_4096**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1026,520,288,528,192,544,70,44,131,81,50,73,15,320,133,52,23,134,384,76,137,82,56,27,97,39,259,84,138,145,261,29,43,98,515,88,140,30,146,1028,71,262,265,161,576,45,100,640,1025,51,148,46,75,266,273,517,104,162,53,193,1032,152,77,164,768,2048,2049,268,274,518,54,83,57,521,112,1024,135,78,289,194,85,276,522,58,168,139,99,86,60,280,89,290,529,524,196,141,1040,101,147,176,142,530,321,31,200,90,1056,545,292,322,532,263,149,102,105,304,296,1030,163,92,1033,47,267,385,546,324,208,386,150,153,165,106,55,328,1088,536,577,548,1034,113,154,79,269,2050,2052,108,578,224,166,519,552,195,270,1041,641,1036,523,275,580,291,59,2056,2064,169,560,114,277,156,87,1152,197,116,170,61,1042,531,525,642,281,278,526,177,293,388,1057,2080,2051,91,584,769,198,172,120,201,336,62,282,143,1029,1044,103,178,294,93,1058,644,202,592,323,392,297,2053,2112,770,107,180,1280,151,209,284,1027,648,94,204,298,400,608,1089,352,325,533,155,210,305,547,300,109,1048,184,534,1060,537,115,1090,167,225,326,306,772,157,656,329,110,2057,2054,117,212,171,1038,776,1064,330,1153,226,549,1043,538,387,308,216,416,271,279,2065,2058,158,337,550,672,1092,118,332,579,540,1072,389,173,1037,121,553,199,784,179,228,338,2066,2176,312,1536,704,1154,2060,2081,390,174,554,581,1046,393,283,122,448,353,561,1096,203,63,340,394,1049,1281,527,582,556,181,295,1059,285,232,2113,2068,124,205,182,643,1156,562,2304,2082,286,585,299,354,1045,211,401,1104,185,1061,396,344,586,645,1282,593,535,240,1050,206,95,327,564,800,2072,2084,402,356,2055,2177,307,301,417,1160,213,1066,568,1120,832,588,1035,1537,186,646,404,1091,227,896,594,418,302,649,2114,2560,771,360,539,111,1052,331,1168,214,2059,2088,309,1062,1284,188,449,1073,217,408,609,596,551,650,229,159,420,310,1093,541,2116,2178,1288,773,610,657,333,1065,119,1098,600,339,1184,218,368,652,1031,230,391,313,450,542,1538,334,2067,2061,2096,2062,1076,233,555,774,175,123,1155,658,2120,2305,612,341,777,220,314,1105,424,1068,395,673,583,355,1296,1094,287,183,234,1051,2069,2180,125,557,1216,660,616,342,2083,2306,316,1157,241,778,563,1074,345,452,397,403,1112,207,2074,2561,1540,674,558,785,1100,432,1039,357,187,1162,236,664,1312,624,587,780,1080,1122,2128,2085,705,126,242,1063,2073,2070,565,398,346,456,2184,2308,358,405,303,569,1544,244,1158,1097,595,1283,189,566,676,1169,1054,1108,361,706,589,1344,215,786,647,348,2312,2086,419,406,2562,2144,464,680,2115,2089,801,1069,362,1164,2192,2076,590,409,1286,570,1121,788,1552,1106,597,1075,572,1186,219,311,708,598,1289,601,651,421,792,802,2117,2090,611,1047,602,1172,410,231,688,653,2564,2097,1128,248,1070,369,2122,2320,190,364,1568,654,1095,659,1161,335,480,315,221,370,1285,613,1408,422,2208,3074,425,451,2568,2336,1077,614,543,1298,235,412,343,372,2576,2240,1185,775,317,1539,222,1099,426,453,237,1124,559,1170,2592,2118,1292,833,804,712,1082,834,661,1053,2092,2179,2129,2098,808,779,1217,617,604,1541,433,720,816,1101,2121,2063,1176,836,347,897,1136,243,1297,662,1600,454,318,675,2368,2181,1110,618,1081,898,781,1314,1220,376,428,1546,2100,2071,665,736,567,1107,2182,2432,1192,1078,2124,2185,840,625,238,1159,359,457,399,787,2130,2104,591,678,434,677,1290,1542,2075,2145,349,1300,1102,245,1188,458,666,1113,620,1553,1163,1313,363,127,1067,191,1125,782,407,436,2087,2307,626,1218,2132,2186,571,465,2193,2309,681,246,707,1346,2077,2091,2146,2563,350,1084,599,668,1548,790,2136,2188,1165,1320,460,1123,1200,249,682,1664,573,1171,411,803,1116,789,1304,709,365,440,628,689,2078,2194,374,1224,3076,2119,423,1556,466,793,2310,2313,2209,2624,1130,250,371,1174,2093,2148,481,574,1348,413,1109,603,366,1545,1287,1055,468,1570,655,900,805,615,1166,684,1409,710,2688,3073,1187,429,2099,2196,794,252,1114,373,605,1232,848,690,2094,2123,713,632,2314,2321,1316,482,806,1132,2565,2152,1083,427,1177,904,1569,414,2210,2101,1291,223,1126,1554,663,692,835,1328,619,472,2241,308 0,1137,455,2200,2125,796,1189,1601,809,714,1248,721,837,716,1086,2212,2816,1302,1352,864,810,1173,606,119
4,912,1103,722,696,377,2316,2322,1424,435,2566,2102,1293,1560,817,1129,1792,319,621,1180,2131,2105,2569,2
160,812,484,1345,430,1572,1138,3072,2183,1299,838,667,1219,2126,2337,488,1111,239,378,459,622,1410,627,22
42,2133,437,380,1201,1608,818,1178,2324,2570,1294,461,1543,496,669,1190,1317,679,2106,2216,1140,1079,218
7,2147,1221,724,841,1305,629,1584,2134,2108,351,467,2328,2137,1360,438,1115,737,2338,2577,251,462,442,441,
2572,2244,1666,469,1549,247,683,1196,2189,3088,2149,2195,1226,842,1412,1127,738,1144,2224,2190,1308,899,
1602,670,1318,783,1085,849,1555,1193,820,1576,728,928,791,367,2578,2369,1376,901,2079,2248,2138,3104,123
3,630,2593,2340,1321,685,844,1204,633,711,2370,2580,2311,2197,2150,2153,1118,253,691,1301,824,1175,2352,2
344,902,686,1668,1222,1416,1133,740,1347,850,375,1558,444,1306,470,1167,483,1547,415,3078,2211,485,905,21
40,3081,1202,795,473,1240,2095,2315,634,744,2433,2594,1616,852,2372,2256,2434,2198,960,1322,2201,2213,86
5,693,2154,2103,1131,1794,1350,797,1225,1604,1571,906,2376,3136,1252,715,1141,1330,807,474,636,1179,694,2
54,1550,1665,2584,2625,717,1071,2596,3082,1315,575,913,1440,798,811,379,1208,2161,2202,1353,1191,2127,23
17,697,1564,431,1142,607,1228,2156,2626,489,1324,2272,2214,866,723,2567,2600,486,1573,1181,1234,908,1793,
1561,718,813,1364,2243,2318,476,856,3089,2689,1117,1411,839,1329,1295,1146,3084,2571,725,698,1472,914,23
23,2628,1249,752,868,819,1349,814,439,929,2339,2107,1197,1578,490,1139,2217,2608,1680,623,2162,2325,1632,
1336,671,1198,1362,739,2204,2135,1603,1557,3200,2245,2164,2218,1413,916,1303,463,1236,843,2109,3090,1135,
381,1672,1354,2579,2573,497,1586,930,821,2690,2329,726,961,1203,1182,2326,2574,872,1418,492,1250,1332,63
1,2225,2341,2436,3105,1574,1223,729,1145,1605,700,2139,2632,1796,443,2817,2246,1307,741,2220,2168,1378,1
562,1356,1205,845,1319,2249,2384,920,382,2110,2330,1585,822,1425,851,2191,3077,3092,2151,1229,730,1609,4
98,2226,2342,880,1256,742,445,1392,471,2141,3106,2692,2250,2640,2371,635,1148,1696,932,1580,687,2440,234
5,1210,1420,1612,1325,1800,903,1134,825,1235,1361,500,1577,846,1670,1195,745,2818,2155,2228,3328,826,732,
2199,2257,2332,3075,1264,446,2696,2142,962,1426,1620,936,2252,2346,1377,475,2448,2656,3137,2400,2373,258
1,853,1310,867,637,2203,2258,1551,1230,2353,2595,1414,907,1206,1667,1588,1333,487,1808,2348,2157,695,144
1,1087,746,828,753,1610,854,1237,1326,3096,2232,857,1368,2582,3108,1209,504,799,1355,2585,2163,255,964,31
38,2215,2273,2374,1242,909,2354,2820,2205,2704,1673,1559,1309,719,2377,2158,1143,477,2165,2260,1617,915,
1448,1380,2219,3086,638,748,2824,3112,944,1728,1331,1227,869,1592,1428,491,699,1253,1351,754,2378,3201,1
183,1565,2274,2597,858,1618,1417,1476,3091,2586,478,968,1260,383,2435,2356,1212,910,1801,815,2264,2464,1
579,976,2319,2327,870,1684,1633,917,2206,2385,2598,2720,3140,2166,1337,1241,2380,2627,1606,1824,727,1150,
1442,493,1357,1251,2588,3120,1676,873,2437,2221,1384,701,3085,2169,1566,931,1323,1798,1365,1473,2601,22
47,756,1334,860,499,2832,2227,731,1648,1238,823,1575,922,1199,1674,2276,2386,874,1432,1421,918,2360,3584,
2752,3202,1636,1254,2438,2222,502,1795,2602,2629,933,1366,3094,2441,1338,1682,2331,2170,2496,2401,1587,1
211,1488,743,1358,760,2609,3144,1244,1581,881,1147,2251,2111,494,1379,1272,702,2388,2442,3097,3329,921,1
624,501,876,2575,2630,1415,847,1856,1444,992,1697,2604,2229,2343,3107,2333,2280,447,1607,1436,1369,2172,
2253,1257,1704,2230,2691,733,1797,3204,2610,1669,1340,1231,827,1590,934,2334,2633,1634,1474,2347,2402,30
93,2259,882,937,2449,3152,2233,3109,963,1419,747,1265,2444,2392,1119,505,1381,855,2634,2693,924,1810,333
0,2641,2583,2288,3098,2254,734,829,1563,1213,2143,2375,1611,1363,2612,2848,1430,1258,1688,1386,965,1614,
1730,1239,2450,2404,938,884,506,1327,1589,1804,2355,2349,2465,3208,749,1370,2261,3114,2616,3168,1640,945,
2880,2636,966,1456,1681,755,3083,3585,2234,2694,1266,859,2452,3139,2275,2944,2642,2466,1427,1593,1388,9
40,2350,2697,1214,830,2819,2408,1809,911,1621,1582,2587,2159,1832,871,3100,2379,639,1480,1698,13

35,888,1
372,1245,479,1422,1268,3216,2262,946,1732,2357,3
110,1677,750,1802,1626,3332,2236,2497,3121,1393,
969,2265,
2456,2657,2644,508,1613,2599,2698,2277,2207,861,
1446,2468,2358,1857,1339,3141,2589,757,1382,3336
,2821,9
70,1700,2658,2705,2381,3113,1243,919,2167,3146,1
594,1433,1826,1504,875,1635,1259,862,2648,2387,1
920,1675,
3232,2266,1445,758,2416,2700,1149,948,1359,1816,
3079,2278,1596,1671,1712,977,2439,2361,1385,923,
1622,97
2,2498,2590,1434,1311,3586,2382,1729,761,1396,87
7,3124,2281,2603,2822,2223,2171,3203,2706,1207,1
475,2660,
2389,1449,1812,952,1686,2825,2268,495,1262,2362,
3153,1644,1619,2472,3116,1341,1429,2443,2721,182
5,703,1
371,1638,1567,1736,2631,2403,935,1685,978,1625,3
344,3142,883,762,1246,503,2335,2231,1458,925,139
4,1269,2
282,3099,878,1478,735,1799,2173,2605,3264,2708,2
664,2390,1678,1860,2364,3205,2289,2826,2611,3122
,1443,16
37,2393,2500,1481,1373,2445,2451,3160,2255,1699,
1255,993,1591,1828,1452,3588,2722,885,939,994,14
00,2606,
2833,3148,2480,1744,1656,3087,2405,2235,3210,980
,1689,926,764,2284,2712,1270,941,1628,1367,1805,1
457,336
0,2672,2635,2828,3128,3170,1921,1583,2753,2174,1
387,1642,2290,3111,967,1267,2613,2446,1484,1450,
2394,250
4,886,831,1683,1342,1811,947,2406,2453,2351,2617,
3592,2292,1705,1431,3206,3145,2643,3331,507,1261
,1840,8
89,2237,2614,1650,984,1760,1490,2724,3217,3102,3
156,1615,751,2409,2754,2637,3392,2263,2834,1702,
942,1858,
1423,2695,2396,1460,1383,2467,2454,996,1692,1641
,1814,971,1477,2512,2728,1273,1512,1733,890,1598,
1374,2
849,3117,2410,3212,509,1806,2638,2457,3334,2618,
1922,1649,3169,2836,3600,3154,949,973,2645,3123,
2620,323
4,1397,1489,2267,2359,2756,2646,3337,2649,1708,1
627,2699,2469,1000,1690,2840,2850,892,1274,2659,
3095,143
8,1817,2650,3220,2458,2279,1390,1464,2736,2701,1
868,950,1151,1731,1506,1827,1597,863,3176,2296,3
118,2417,
1451,759,2238,2412,1864,1714,3616,2702,3143,2707
,1701,1395,3209,2383,2528,2363,1803,1008,2269,24
18,3333,
2661,1623,1482,3456,2470,1276,510,2473,2499,1435
,1652,3125,2662,2591,3346,2283,2460,2391,2420,97
9,1492,
3233,2823,953,1928,1829,1389,2365,3587,1738,763,
2270,3147,1872,974,2474,2501,1453,1643,2285,3172
,1713,18
18,1215,1402,2607,3218,1629,1520,1830,1691,3340,
2881,954,1459,1734,879,2852,2760,3130,2882,981,1
505,2709,
3101,1706,982,2856,2827,3265,2665,2652,3589,2481
,2768,2864,3149,1924,927,3224,2884,1833,1639,239
5,2945,
3184,2291,1447,1746,3345,2710,1343,1679,3648,250
2,2366,2723,1820,1761,1479,1275,995,1740,3158,26
66,1401,
1888,765,956,3129,2946,2829,3362,1496,1861,3268,
2424,887,1437,985,1720,2476,3594,997,1630,1813,1
462,2713,
2784,2615,3155,3240,3126,1398,1645,2888,2673,228
6,3207,2407,2505,2447,2835,1848,1687,2639,2726,1
247,171
6,2482,2725,3338,3590,1936,986,1483,1651,1745,94
3,2397,3348,1859,1508,3150,2293,3236,2506,1834,1
454,2714,
3161,2668,3601,891,1841,998,1595,3211,3361,1278,
766,1465,1709,2411,2175,1764,1646,3115,2239,3173
,2830,2
455,2484,1737,511,2674,3266,1485,1404,2619,2513,
1693,1866,2729,2294,2755,3394,1952,1491,988,1657
,1752,18
07,2398,3132,2647,2716,3596,2838,1399,1844,3213,
3368,2508,3171,1001,951,1654,1926,3248,2297,2730
,3712,17
07,1391,2621,3219,2459,2851,1002,1468,3164,2837,
3352,2757,2413,2488,1836,1494,1873,1271,2676,273
7,1694,8
93,2422,3272,1923,1461,2471,3604,1748,1715,2514,
2841,975,1862,894,1815,3178,2298,2419,3222,1497,
1653,252
9,2622,3396,2461,3157,2651,2414,3593,1510,1762,3
335,3103,2516,3618,1842,1375,2703,2948,2853,2663
,3214,27
32,1703,1009,3457,2758,1466,1874,3235,2477,955,1
739,2842,2300,3162,2421,2653,3280,2896,2738,1486
,1930,27
61,2680,1889,1004,1658,1821,1718,1929,3364,2530,
2854,3180,1599,1507,3131,2475,1776,1405,3225,295
2,3617,2
462,1735,1831,3339,2271,3174,3602,1493,1010,2711
,2740,2883,3376,1984,1455,2667,2520,957,1865,318
5,2503,2
844,3237,3649,2857,2762,3296,2769,2885,2764,3134
,983,1710,3350,3400,958,1514,2912,2858,3221,2654,
1876,17
68,3242,2960,1721,1938,3151,2770,2744,2425,1660,
1500,1403,1892,3472,2483,1819,1741,1516,987,3341
,3608,19
32,1463,2865,3177,3840,2367,1012,1843,2669,3228,
1749,999,2860,2532,3393,2478,3620,3186,3347,2886
,2715,32
67,1838,1277,2536,3159,2287,2426,2507,2670,3458,2675,1647,1925,2485,2428,1498,1742,3249,3656,2866,3226,1513,1880,1717,1016,1953,1837,3342,2509,1867,1631,3591,2544,2717,3238,1469,1747,3365,2727,767,1904,1724,1524,3188,3127,989,1406,1754,1822,3269,2772,2889,3353,2677,3632,2399,2515,3408,2486,3163,2785,2299,2510,2490,2489,1835,1499,3714,2517,3597,2295,2731,3244,1944,1863,1890,1467,1003,1522,3274,2890,3460,3175,2786,3192,1763,1695,3356,2947,3650,2718,1850,990,1005,1937,3366,2831,3133,2897,1722,1845,3603,3241,1495,1655,2868,3624,2776,2976,2839,2415,1765,1956,3424,2949,1487,1750,3281,2678,1869,1521,3369,2733,2892,3252,2681,2759,959,1896,1263,1940,3166,2301,2739,3349,2872,3223,1770,1877,2950,2734,3716,3270,1509,1711,3464,3181,2788,3395,1756,1846,2898,2423,3606,2492,1011,1960,3354,2518,3215,2531,3595,2463,1784,1870,1662,1013,2533,2953,1985,1753,3250,2843,2521,3288,2682,2792,1927,1528,3664,2900,1849,1882,3008,3370,2913,2741,1766,1511,3179,3842,3398,2845,3273,3652,3619,2954,1954,1719,3300,2763,3189,3378,1777,895,2855,2522,2684,3227,2742,2302,1439,1006,3598,3713,1878,1891,2765,3119,3363,2623,2961,3488,2846,2859,2427,3256,1939,1661,3401,3239,1502,1986,2745,3612,1852,1934,2479,3190,2655,3276,2537,3372,1723,1772,2914,2771,1515,1897,2534,3621,3229,3282,2956,3841,3609,2766,1014,1470,2861,3412,1743,1931,2524,2904,3165,3459,2887,3377,3343,3194,2773,2746,3520,2962,1017,1968,3297,2800,2916,2867,3397,2862,2487,2977,1881,1894,3245,3626,1769,1517,2538,3187,1778,1941,1823,1659,3728,2671,1992,1875,3680,3384,1755,1501,2719,3246,3410,2787,1018,1900,3651,3605,1725,991,3461,2964,3351,2511,3284,2891,3183,2429,3720,3402,2545,3634,2978,2869,2774,3009,3251,3230,1933,1839,2920,3466,2540,3298,3380,2679,1525,1955,1988,1884,1726,1948,3622,3271,2777,3193,3653,2748,1780,1518,3844,2491,1020,1767,1905,1851,3355,2789,1893,1945,3426,3610,3404,3253,2893,3367,2968,2430,3633,2870,3473,2899,3277,2778,3657,2546,1757,1530,2928,3304,2790,2493,3440,2519,1958,1471,1007,2000,2683,3196,3744,2980,3628,2735,1847,1898,3258,3468,3660,3373,1523,1942,3848,2951,3182,2873,1961,1871,3283,3409,1771,1529,2548,3625,2894,3718,3243,2793,1912,1758,2874,2780,1989,1946,3312,2494,3010,3474,3668,2984,3425,2523,1526,1906,2901,3358,2915,2685,3599,3278,1883,1773,3462,2955,3254,3715,3636,3381,2535,3856,1957,1853,2743,3489,3135,2794,1976,1015,2876,2801,3658,2902,3285,3374,1751,1993,1503,1962,2905,3416,3257,2552,2847,3403,2303,3012,1781,1885,3290,2957,1908,2016,3721,3607,3357,2767,3191,2525,3665,2963,3496,3428,2686,2796,1854,1532,2992,3776,3379,3275,2917,3640,3476,2539,2747,3301,1972,1774,3399,2802,1019,1895,3231,3613,2906,3666,3465,3524,2526,3016,3308,2431,1987,1969,3260,2958,3849,2863,3627,3024,1782,1279,2918,3732,3681,2965,1943,1899,3385,3289,1994,1663,3654,3872,2775,3198,3490,2541,3405,3299,1964,1785,3724,2921,1021,1935,3432,2749,3614,2979,3371,3846,3413,3521,2804,3382,2908,2547,2779,3696,3286,2871,3623,2970,3247,3722,1886,2001,2922,3480,3469,2966,1407,1779,1990,1970,3684,3302,2550,3843,1879,1022,2981,3414,1902,1947,3386,3730,3635,3259,3536,2791,3406,2808,3292,3629,2929,3195,2542,3427,3320,2750,2969,3672,2549,2924,1759,1907,3463,2895,3904,3492,3040,3745,1527,1996,1786,1959,2495,3655,3484,3417,2002,1913,3305,3752,1949,2017,2781,3845,1534,1788,3717,3388,3279,2875,3638,2982,3682,3522,2930,2985,3011,3467,2795,3313,3167,2553,3429,2903,2972,3858,1910,1965,2782,2877,3611,3261,3659,3411,2004,1901,3478,3306,3736,3434,3013,3662,3778,3287,1966,1775,2986,2932,2008,1531,2554,3375,3637,3852,1971,1950,2797,3418,3688,2993,3014,3504,3729,2803,3314,2907,1909,1991,3475,3641,3436,2988,3262,2878,3857,2959,3669,3630,3880,2919,2018,1727,2687,3528,3746,3383,2936,3420,3293,2527,3470,3316,1916,1855,1974,1995,2994,3780,3725,2798,3850,3674,3441,3017,2020,1977,2556,3661,2909,3494,3905,3387,2805,3430,3018,3748,3291,2967,1787,1914,3642,3481,3874,3552,2923,3683,3307,2910,2005,1887,3968,3723,1023,1963,3493,2806,3197,2996,3407,3864,3644,3719,3760,3025,3433,2971,3670,3020,3482,3359,1998,1783,3777,2809,3444,2925,2024,1980,3255,3523,3497,3860,3000,3734,2543,3310,1903,1973,3692,3667,3 389,3477,3873,2751,3419,3686,3615,3784,2983,3733,3026,3673,2931,2810,3294,2551,3506,2973,3442,3317,2003,1789,2926,3526,2783,3847,1997,2032,3726,3908,1978,1917,3491,3685,2010,1519,3529,3421,3747,3303,3041,3639,3876,3500,2933,2987,3042,3448,3792,3704,3028,3737,2974,2812,3318,2989,3676,3415,3853,3505,2019,2006,3969,3631,3435,3690,1951,1911,3015,3315,3532,3498,2021,2009,2934,2879,3731,3390,3859,2995,3753,3479,2555,3309,3888,2937,3698,3032,3808,3538,3663,2799,1790,2026,3750,2990,3906,3471,3508,3431,3044,3740,3689,3862,3019,3525,1975,2012,3321,3560,3781,2938,3646,3422,1967,1915,2557,3854,3970,3697,2997,3021,3445,3537,3756,3675,3048,3738,2940,3322,3486,3865,3438,3512,2025,2022,3916,2998,3199,3779,3554,3875,3645,2911,1981,1918,2033,1999,3499,2807,3912,3762,3749,3443,3851,3056,3671,3530,3324,2558,3483,3700,3027,3540,3001,3976,3877,3437,3786,2811,2028,1533,3920,3022,3501,3691,3761,3866,3263,3450,3677,3568,3878,3739,3002,3507,3782,2927,3029,3553,2011,1982,3754,3030,3972,2975,3881,3687,3495,3794,2034,1979,3391,3727,3868,3809,3527,3323,3043,3788,3449,3936,2813,3004,3544,3909,2935,3485,3033,3768,3045,3678,3861,3510,2023,2013,3446,3693,2036,2007,3896,3735,3295,3764,3984,3034,3531,3699,3793,2991,3907,3556,3882,3502,2939,3889,3046,3643,3326,2814,3513,3757,3812,3694,2030,2014,3785,2559,3533,3452,3741,3914,2040,1535,4000,3539,3036,3705,3800,3855,3447,3892,3049,2999,3702,3974,3755,3439,3050,3516,3884,3542,3921,3319,3742,2941,3971,3509,3796,3763,2027,2029,3023,3910,2942,3863,2035,2037,3545,3701,3558,3810,3890,3423,3751,3057,3514,3922,3003,3787,3534,3978,3937,3052,3706,3869,3766,3977,1791,2038,3647,3555,3824,3453,3783,3879,3541,3058,4032,3503,3005,3913,3031,3758,3006,3562,3924,3816,2041,1919,3769,3986,3708,3548,3451,3940,3867,3789,3564,3035,3980,3511,3060,3891,3797,3047,3886,3325,3695,3973,3546,3790,3561,3928,3765,3064,4001,3885,3915,3679,3517,3795,2815,3952,3772,3572,3037,3454,3802,3870,2042,2039,3883,3547,3992,3911,3938,3515,3051,3570,3811,3743,3898,3038,3053,3985,3770,3893,3543,3703,3813,4004,3535,3798,3917,3569,2044,2043,3007,3944,3311,3988,3818,3925,3557,3759,3804,3894,3059,4008,3832,3918,3710,3061,4033,3801,3975,3576,3897,3930,2031,1983,3814,3559,4002,3767,3825,2943,3487,3054,3926,3939,3987,3709,3550,4034,3900,3982,2046,2047,3771,3820,3563,3945,3062,3518,3791,3979,3065,4016,3929,3942,3817,3565,3826,3989,3871,3707,4040,3923,3803,3549,3066,3948,3773,3039,3981,3887,3573,4003,4036,3932,3774,3996,3828,3566,3068,3815,3953,3899,3941,3993,3805,3578,4006,3519,3055,4048,3895,3946,3571,3990,4009,3919,3819,3577,3960,3806,4037,3994,3574,3954,3931,3821,4005,3901,4024,3063,3799,4041,3551,4010,3829,3933,3956,4064,2015,2045,3902,3580,4020,3822,3067,3943,4035,4017,3830,3327,3991,3947,4042,3711,4012,3833,3069,3983,3934,4049,3455,3827,4038,4018,3927,3070,3950,3995,3807,3955,3575,4044,3834,4007,4050,3961,3997,4065,3582,3836,3958,4013,4052,3949,4014,3823,4056,3579,4019,3998,3957,4039,4066,3775,3964,3903,4022,4043,4068,4025,3835,3962,4053,3935,3071,4011,4046,3831,4072,4028,3951,4021,4051,3837,4045,4080,4026,3965,4058,3567,4067,4054,3999,3959,4069,4057,3838,4074,4023,4060,4015,3963,4073,4070,4029,3966,4081,4047,4076,3581,4059,4030,4082,4027,4071,4061,4084,4055,4078,4062,4088,3583,4075,4077,4083,4085,3839,4086,4089,3967,4090,4087,4092,4091,4079,4031,4094,4095,4063,4093]

**Sequence group 6: Z6_4096**

[0,1,2,7,3,8,11,24,4,10,13,28,16,33,35,77,5,12,14,32,19,38,47,81,22,46,42,88,57,96,102,168,6,17,21,40,23,45,51,90,29,55,59,97,72,110,116,186,34,61,75,114,80,123,135,197,87,137,148,225,153,238,260,381,9,18,26,54,30,58,71,105,36,76,62,117,84,127,142,206,44,74,86,136,92,145,152,233,100,155,170,252,184,268,287,424,53,89,98,151,111,162,178,265,121,179,196,279,210,301,317,461,139,204,230,307,236,320,345,494,257,353,375,519,396,544,587,815,15,25,31,73,39,79,82,141,48,85,93,150,101,160,165,262,56,94,103,163,115,177,193,282,126,194,205,296,232,314,340,481,64,108,122,183,128,195,213,309,149,228,237,322,256,351,369,518,164,246,266,357,280,389,3 98,539,303,412,446,574,471,608,678,817,69,124,144,216,159,235,255,355,169,258,271,380,288,397,423,563,191,283,297,409,321,438,465,618,334,474,499,650,527,688,714,943,212,310,328,450,358,480,503,667,393,515,540,704,576,718,786,1016,421,554,588,753,603,805,833,1073,673,853,883,1064,915,1129,1203,1490,20,37,41,91,49,95,106,176,50,107,118,187,132,207,217,336,63,119,133,222,146,231,244,337,154,243,261,374,284,392,404,538,67,143,156,224,173,247,267,390,181,275,289,406,300,435,454,600,180,298,312,434,333,468,483,651,362,505,528,687,552,712,758,993,78,167,174,273,190,294,311,425,198,316,326,463,346,492,509,685,259,341,359,497,382,525,549,706,415,558,594,750,621,802,840,1054,293,377,407,535,431,573,598,788,459,614,634,814,679,864,894,1103,500,675,689,884,707,917,870,1145,769,981,1017,1218,1025,1315,1367,1549,83,188,192,332,248,350,368,504,274,373,383,532,414,560,593,790,290,410,430,561,448,599,625,820,475,639,666,858,705,891,939,1153,335,436,453,624,482,657,693,874,530,696,716,935,770,911,1003,1228,571,742,796,985,821,1024,1059,1278,865,1067,1066,1351,1147,1387,1431,1684,376,472,506,697,559,717,757,955,595,789,807,1018,850,1033,1065,1309,628,829,876,1055,898,1071,1149,1389,951,1162,1199,1441,1254,1509,1546,1821,686,888,929,1151,1001,1156,1242,1464,1014,1234,1284,1529,1334,1581,1658,1934,1035,1320,1381,1605,1414,1668,1630,1963,1485,1725,1760,2074,1844,2124,2211,2399,27,43,52,99,60,120,134,214,66,138,147,221,158,241,245,386,68,157,166,240,175,295,304,420,200,306,331,460,348,485,507,702,70,172,189,299,202,329,342,478,215,354,370,516,388,545,568,720,229,378,401,556,426,592,609,776,440,601,641,828,648,856,889,1213,109,201,211,347,223,371,387,534,253,405,416,580,443,616,638,794,272,419,452,606,477,646,653,842,496,655,664,893,740,918,975,1230,291,476,490,662,524,691,701,903,548,739,763,950,810,994,1019,1289,579,785,824,1021,866,1050,1113,1337,925,1120,1166,1396,1200,1451,1518,1814,112,219,242,399,270,417,447,620,286,455,479,656,501,669,681,900,315,491,521,683,547,730,755,946,577,774,808,1010,843,1036,1091,1294,343,533,567,759,610,797,795,1039,629,832,854,1074,905,1117,1137,1401,668,867,921,1130,947,1181,1202,1468,980,1226,1267,1530,1347,1591,1661,1947,364,586,615,834,652,863,907,1121,727,924,962,1195,966,1208,1249,1505,743,964,979,1239,1047,1266,1326,1578,1100,1344,1379,1608,1425,1694,1738,1974,775,1061,1084,1297,1142,1355,1386,1647,1167,1419,1471,1720,1519,1768,1831,2089,1273,1473,1533,1781,1602,1858,1887,2185,1649,1913,1961,2235,2025,2312,2385,2666,129,254,278,458,313,489,517,711,324,526,555,737,581,766,819,1093,356,569,619,791,643,861,845,1102,658,877,914,1161,958,1187,1216,1486,427,632,659,859,726,902,930,1198,736,961,973,1217,1000,1250,1277,1555,744,990,1028,1275,1098,1323,1371,1611,1132,1411,1424,1701,1472,1739,1801,2057,442,725,729,948,749,965,1009,1260,784,1048,1081,1311,1118,1362,1416,1673,920,1095,1144,1373,1171,1448,1475,1727,1255,1480,1540,1787,1604,1850,1879,2179,972,1180,1238,1450,1274,1526,1562,1811,1332,1587,1618,1876,1669,1915,1972,2261,1384,1654,1712,1960,1759,2008,2056,2322,1818,2077,2117,2378,2158,2459,2472,2831,451,751,765,1089,901,1107,1136,1409,937,1157,1191,1459,1246,1497,1553,1805,977,1214,1269,1513,1307,1565,1621,1869,1366,1666,1613,1903,1730,1967,2024,2283,1101,1279,1322,1595,1399,1634,1703,1954,1437,1713,1758,2009,1797,2029,2097,2363,1522,1775,1826,2061,1891,2136,2173,2431,1930,2228,2258,2510,2313,2560,2578,2754,1176,1327,1434,1718,1491,1752,1778,2048,1547,1839,1862,2110,1905,2137,2239,2470,1559,1899,1956,2224,2022,2266,2271,2574,2081,2324,2359,2603,2414,2672,2719,2941,1676,2002,2010,2306,2106,2328,2380,2617,2154,2430,2444,2704,2525,2720,2839,3018,2201,2503,2551,2782,2612,2793,2884,3089,2651,2902,2936,3142,2984,3186,3223,3400,140,113,65,285,104,263,182,502,125,185,203,444,220,352,323,572,161,218,239,330,264,408,372,663,302,384,422,541,462,731,612,897,171,249,269,391,305,413,469,589,325,493,439,816,531,633,674,1209,349,473,557,647,514,700,781,1043,582,764,728,934,841,1094,967,1470,199,292,308,449,344,484,537,682,379,605,495,715,570,745,804,978,411,529,645,777,613,892,762,1015,562,809,916,1060,860,1258,1128,1724,4

41,642,5
83,851,719,818,944,1083,672,991,882,1184,931,1141
,1410,1314,752,954,1005,1285,1042,1196,1229,1508,
1085,13
45,1263,1655,1397,1890,1579,2174,234,327,365,520,
400,553,604,787,437,684,575,812,635,848,904,1150,
464,611,
721,857,665,974,885,1133,748,936,1029,1201,995,12
44,1329,1536,498,710,649,910,806,959,1037,1223,78
0,1097,
976,1418,1075,1282,1295,1614,852,1026,1160,1328,
1119,1361,1460,1924,1219,1484,1404,1645,1552,174
1,1800,2
248,546,738,825,1011,768,1046,1139,1343,871,1188,
1080,1525,1231,1378,1455,1700,919,1112,1245,1412
,1310,1
476,1610,1755,1163,1573,1496,1868,1652,1820,1962
,2352,963,1272,1335,1583,1194,1531,1627,2001,138
5,1690,1
749,1878,1548,2075,1935,2756,1430,1721,1786,2049
,1823,1969,2028,2455,1660,2114,2159,2305,2210,26
29,2384,
3163,281,385,418,607,470,690,640,896,488,654,798,
942,724,988,1032,1262,536,754,703,1008,803,1131,9
70,1308,
862,1049,1148,1354,1088,1504,1449,1909,578,813,7
67,1212,928,1038,1092,1363,849,1116,1177,1596,12
35,1407,
1477,1761,949,1261,1197,1524,1336,1463,1603,1817
,1293,1572,1638,1855,1699,1942,2059,2296,617,100
2,835,11
43,890,1276,1186,1532,971,1222,1317,1487,1360,15
82,1648,1892,1058,1413,1296,1745,1251,1598,1635,
2031,148
1,1687,1769,1948,1819,1995,2119,2495,1106,1440,1
358,1659,1515,1726,1859,2103,1590,1902,1751,2044
,1796,22
31,2168,2439,1388,1838,1968,2195,1914,2142,2338,
2424,2011,2310,2249,2596,2403,2539,2673,3214,692
,906,102
0,1259,1082,1306,1458,1672,1140,1542,1333,1719,1
405,1620,1822,2099,984,1372,1435,1794,1528,1943,
1748,206
9,1619,1873,1908,2214,1686,2323,2162,2838,1215,1
469,1580,1990,1675,1886,1851,2292,1514,1928,2053
,2184,20
05,2242,2373,2557,1779,2033,1966,2259,2102,2463,
2331,2607,2169,2386,2506,2703,2445,2662,2885,301
7,1268,1
599,1707,1925,1543,2111,1973,2304,1815,1994,2207
,2360,2052,2402,2520,2742,1646,2143,2083,2413,22
25,2550,
2453,2730,2318,2478,2642,2693,2595,2931,2858,309
8,1875,2267,2176,2535,2367,2770,2488,2815,2115,2
648,257
9,2874,2602,2917,2981,3473,2253,2747,2705,3032,2
669,2968,3064,3256,2805,3043,3009,3317,3127,3609
,3272,37
01,363,445,508,713,566,741,799,1034,602,895,771,1
152,844,1072,1204,1454,644,811,945,1096,875,1301,
1146,15
03,989,1248,1359,1740,1227,1537,1594,1950,680,93
8,899,1190,1004,1243,1342,1612,1099,1415,1283,15
58,1400,
1653,1807,2041,1051,1370,1321,1644,1462,1762,170
2,2003,1527,1795,1872,2381,1896,2178,2118,2534,7
56,960,1
090,1300,1189,1346,1576,1685,1027,1380,1474,1744
,1406,1845,1753,2088,1170,1512,1541,1939,1436,18
06,1904,
2206,1667,1957,1833,2151,2030,2252,2329,2657,129
2,1564,1706,1877,1626,1991,1949,2287,1774,2108,2
045,224
3,1938,2339,2391,2638,1609,2131,2080,2361,2215,2
479,2432,2731,2017,2415,2526,2923,2594,2855,2792
,3173,85
5,1205,1070,1461,1138,1698,1417,1897,1316,1502,1
615,1883,1586,1830,1982,2297,1288,1780,1639,2058
,1563,19
55,1931,2349,1750,2023,2155,2255,2107,2406,2458,
2713,1398,1677,1816,2000,1863,2194,2096,2502,169
1,2068,2
270,2438,2150,2387,2575,2771,1898,2246,2189,2467
,2353,2650,2528,2825,2325,2588,2726,2870,2668,29
40,2972,
3349,1523,1912,1754,2175,1827,2116,2260,2544,195
1,2398,2234,2511,2307,2601,2643,2888,2016,2362,2
293,266
3,2466,2616,2743,3096,2416,2797,2674,2930,2776,3
008,3051,3248,2082,2303,2489,2712,2390,2738,2814
,2985,25
85,2916,2764,3042,2871,3073,3139,3313,2538,2830,
2920,3215,2980,3108,3162,3419,2790,3183,3258,338
6,3273,3
459,3530,3756,992,1247,1185,1631,1350,1695,1597,
1975,1408,1554,1832,2200,1763,2032,2125,2417,146
5,1804,1
731,2060,1929,2330,2109,2473,1893,2163,2247,2600
,2302,2527,2675,2922,1577,1946,1874,2177,2004,22
30,2254,
2545,1810,2286,2372,2692,2452,2653,2628,2961,207
6,2379,2494,2613,2425,2727,2777,3026,2348,2808,2
718,298
7,2862,3083,3126,3361,1674,1854,2098,2366,1983,2
319,2471,2701,2188,2561,2407,2656,2172,2746,2791
,3039,22
38,2454,2507,2927,2584,2765,2842,3222,2649,2912,
2809,3072,2971,3109,3208,3397,2311,2524,2702,284
3,2597,2
990,2913,3143,2755,2875,3027,3169,2937,3303,3226
,3434,2667,2986,3065,3249,3112,3334,3294,3505,30
50,3265,
3387,3553,3360,3469,3583,3777,1882,2040,2130,246
2,2282,2639,2433,2804,2229,2529,2521,2889,2606,2
960,286
3,3187,2358,2721,2589,2854,2757,2921,3033,3168,2

700,2991,3055,3227,2973,3268,3323,3504,2412,2652,2824,2969,2739,3082,3016,3259,2783,3038,3099,3401,3182,3295,3312,3552,2903,3155,3217,3322,3138,3435,3362,3544,3088,3373,3468,3639,3425,3582,3629,3869,2556,2796,2859,3154,2970,3054,3216,3335,2926,3097,3172,3363,3257,3464,3418,3585,3019,3209,3264,3458,3302,3396,3499,3667,3316,3511,3472,3628,3545,3663,3693,3964,3113,3269,3348,3498,3372,3510,3573,3662,3424,3572,3531,3728,3608,3729,3692,3868,3465,3584,3638,3734,3666,3735,3757,3819,3700,3776,3818,3845,3844,3965,3886,3887,130,131,208,251,209,276,319,432,226,318,339,466,366,511,513,747,227,338,360,510,395,542,591,773,428,590,564,800,637,836,868,1108,250,367,403,550,429,585,623,822,467,631,661,837,732,886,922,1164,512,671,735,912,772,941,987,1183,793,997,1040,1281,1053,1312,1368,1657,277,394,456,630,486,660,723,873,522,746,676,923,782,957,1012,1224,584,734,792,996,826,1023,1052,1299,846,1057,1110,1348,1158,1390,1433,1742,627,801,838,1045,887,1078,1126,1377,933,1127,1182,1421,1232,1467,1507,1809,999,1220,1290,1489,1304,1510,1571,1870,1357,1593,1641,1921,1688,1976,2043,2389,361,433,487,733,543,761,778,1007,596,783,827,1044,847,1076,1087,1374,636,830,869,1079,913,1125,1175,1426,956,1178,1221,1452,1298,1500,1566,1849,694,880,940,1155,968,1179,1237,1493,1041,1286,1305,1516,1356,1589,1629,1920,1086,1338,1382,1607,1422,1679,1692,1965,1479,1716,1784,2020,1835,2078,2186,2393,709,952,1022,1252,1069,1303,1353,1601,1109,1364,1393,1656,1438,1689,1737,1999,1173,1427,1453,1711,1511,1770,1825,2094,1556,1840,1885,2144,1933,2202,2236,2547,1236,1494,1538,1790,1616,1848,1895,2167,1683,1917,1970,2220,2026,2244,2342,2632,1735,1986,2046,2291,2067,2369,2409,2697,2181,2435,2475,2688,2513,2759,2837,3106,402,523,551,823,597,831,878,1124,622,879,926,1165,982,1225,1253,1560,677,927,983,1270,1030,1291,1330,1561,1056,1325,1369,1640,1428,1682,1704,1964,699,1013,1062,1280,1115,1339,1383,1680,1135,1403,1439,1708,1466,1765,1798,2064,1134,1456,1498,1764,1551,1828,1853,2145,1622,1901,1936,2199,1984,2232,2300,2611,760,1105,1122,1395,1172,1446,1495,1743,1192,1506,1534,1813,1574,1866,1911,2197,1365,1567,1617,1881,1662,1927,1981,2222,1723,1992,2054,2288,2101,2364,2418,2682,1445,1643,1709,1953,1757,2019,2062,2344,1803,2090,2122,2388,2187,2450,2486,2737,1888,2183,2203,2476,2223,2515,2460,2779,2321,2593,2633,2852,2641,2949,2999,3153,779,1168,1174,1550,1340,1588,1628,1900,1402,1637,1663,1944,1722,1996,2051,2346,1442,1714,1756,1997,1788,2063,2105,2396,1841,2127,2166,2442,2221,2483,2543,2789,1557,1766,1793,2104,1852,2153,2209,2464,1940,2212,2240,2537,2326,2509,2621,2864,2015,2278,2354,2599,2397,2640,2685,2910,2451,2691,2690,2983,2781,3013,3057,3260,1642,1836,1906,2213,1993,2241,2299,2563,2055,2345,2371,2634,2428,2655,2689,2945,2112,2405,2468,2683,2492,2695,2785,3015,2559,2800,2833,3063,2890,3119,3150,3357,2198,2480,2531,2787,2619,2794,2876,3080,2630,2868,2918,3135,2964,3179,3240,3432,2659,2952,3007,3199,3044,3246,3220,3453,3103,3289,3318,3520,3374,3554,3597,3695,457,565,626,839,670,932,986,1240,698,998,1031,1265,1068,1319,1331,1670,708,1063,1104,1318,1123,1447,1482,1734,1206,1488,1545,1808,1584,1857,1907,2218,722,1114,1169,1457,1210,1539,1568,1846,1241,1600,1632,1918,1678,1977,2012,2250,1287,1650,1697,1988,1746,2050,2079,2334,1772,2065,2129,2404,2140,2440,2481,2847,881,1207,1233,1575,1271,1633,1671,1952,1349,1705,1728,2036,1777,2092,2126,2350,1394,1733,1792,2072,1843,2138,2147,2420,1880,2149,2164,2485,2276,2516,2583,2866,1443,1842,1864,2160,1926,2205,2217,2499,1980,2275,2309,2558,2376,2614,2635,2925,2035,2341,2400,2637,2456,2680,2745,2967,2523,2752,2802,3020,2834,3069,3124,3350,908,1257,1324,1693,1392,1729,1785,2100,1432,1799,1847,2152,1889,2171,2191,2496,1501,1865,1923,2193,1979,2268,2295,2552,2027,2332,2374,2626,2421,2660,2717,2932,1569,1945,2007,2301,2084,2355,2351,2665,2113,2408,2436,2698,2501,2749,2767,3025,2170,2457,2519,2760,2553,2813,2836,3084,2592,2860,2899,3136,2979,3189,3243,3441,1624,2042,2091,2410,2146,2449,2505,2753,2263,2522,2568,2827,2572,2844,2883,3117,2279,2570,2591,2873,2677,28 98,2956,3176,2734,2976,3005,3200,3053,3270,3296,
3462,2333,2687,2710,2935,2774,2989,3012,3233,280
3,3049,3
087,3286,3125,3324,3367,3529,2905,3091,3141,3331
,3196,3380,3403,3587,3235,3421,3451,3607,3491,36
50,3687,
3810,969,1352,1420,1802,1499,1861,1919,2227,1520
,1932,1987,2273,2037,2316,2395,2723,1606,2013,20
95,2347,
2133,2447,2423,2736,2156,2469,2512,2799,2564,281
9,2850,3104,1747,2120,2157,2443,2262,2498,2532,2
832,227
2,2567,2581,2851,2618,2886,2909,3159,2280,2608,2
646,2907,2732,2955,3001,3203,2762,3037,3052,3277
,3090,32
97,3341,3513,1776,2257,2265,2554,2285,2571,2625,
2894,2340,2678,2707,2947,2750,2996,3046,3251,251
8,2725,2
778,3003,2807,3066,3093,3291,2891,3100,3146,3333
,3198,3376,3395,3581,2580,2812,2872,3068,2906,31
32,3164,
3347,2962,3185,3210,3392,3247,3423,3460,3625,301
0,3238,3282,3450,3315,3482,3512,3654,3354,3523,3
549,368
2,3566,3723,3732,3875,1791,2289,2315,2715,2497,2
741,2766,3035,2541,2795,2823,3075,2880,3111,3157
,3343,25
87,2848,2901,3121,2943,3167,3213,3385,2998,3244,
3205,3413,3292,3455,3490,3633,2735,2911,2954,319
1,3023,3
224,3279,3446,3061,3283,3314,3483,3339,3493,3533
,3677,3128,3327,3364,3517,3405,3558,3575,3711,34
30,3602,
3622,3746,3651,3768,3772,3846,2810,2957,3058,328
4,3107,3308,3328,3506,3151,3371,3382,3542,3415,3
559,361
1,3730,3161,3411,3448,3600,3488,3626,3631,3770,3
525,3656,3673,3787,3704,3814,3831,3913,3254,3478
,3484,36
46,3538,3658,3684,3793,3564,3710,3716,3826,3751,
3832,3877,3934,3593,3743,3765,3856,3790,3861,389
2,3955,3
803,3896,3910,3970,3924,3982,3991,4030,1006,909,
695,1429,872,1375,1154,1894,953,1159,1211,1782,1
264,1592 ,1517,2018,1077,1256,1313,1544,1376,171
0,1636,2161,1478,1664,1736,1971,1812,2269,2086,2
491,1111,1341,139
1,1681,1483,1717,1829,2047,1521,1867,1771,2392,1
941,2121,2182,2845,1585,1837,1989,2139,1916,2216
,2337,26
71,2038,2314,2264,2536,2419,2724,2573,3086,1193,
1444,1492,1789,1570,1856,1959,2192,1651,2071,187
1,2237,2
014,2281,2368,2590,1715,1937,2135,2335,2087,2484
,2308,2631,1998,2375,2514,2686,2446,2892,2758,32
88,1773,
2132,2039,2429,2245,2394,2548,2709,2180,2609,247
4,2816,2533,2773,3036,2948,2290,2562,2623,2919,2
670,282
8,2865,3118,2711,2977,2897,3239,3021,3404,3177,3
576,1302,1535,1625,1922,1696,1985,2070,2343,1767
,2196,20
21,2382,2123,2426,2500,2786,1824,2085,2251,2441,
2165,2582,2477,2763,2284,2540,2647,2835,2615,287
8,2959,3
144,1884,2226,2141,2508,2370,2565,2661,2857,2336
,2729,2586,3048,2699,2914,2933,3206,2434,2644,27
98,2958,
2751,2995,3076,3426,2853,3102,3028,3231,3156,329
9,3340,3616,1978,2274,2401,2627,2320,2676,2769,2
975,246
1,2820,2706,3131,2867,3004,3071,3276,2517,2744,2
879,3040,2946,3094,3202,3311,2801,3171,3110,3384
,3236,33
56,3452,3670,2569,2904,2965,3181,2826,3137,3219,
3477,3011,3266,3305,3394,3152,3521,3433,3848,305
6,3287,3
332,3507,3359,3457,3492,3721,3242,3546,3567,3645
,3596,3795,3686,3975,1423,1665,1732,2073,1834,22
04,2128,
2490,1860,2148,2356,2546,2256,2604,2654,2896,195
8,2294,2219,2624,2365,2761,2576,2944,2448,2679,2
784,298
8,2714,3116,3067,3417,2034,2383,2317,2846,2530,2
664,2722,2997,2427,2748,2811,3192,2869,3031,3095
,3319,25
55,2895,2829,3130,2966,3079,3197,3353,2929,3170,
3228,3379,3275,3438,3515,3640,2093,2620,2411,277
5,2482,2
908,2818,3140,2577,2856,2951,3105,2994,3180,3234
,3406,2684,3041,2934,3301,2887,3194,3225,3495,31
01,3263,
3325,3442,3355,3475,3551,3741,2740,3062,2992,324
1,3123,3290,3381,3537,3188,3412,3307,3502,3338,3
605,357
0,3715,3014,3370,3456,3591,3422,3560,3664,3708,3
485,3648,3617,3782,3697,3761,3815,3986,2208,2504
,2636,28
93,2708,2942,3074,3250,2772,3148,2963,3285,3029,
3212,3358,3535,2598,3002,3059,3336,3134,3439,330
4,3519,3
211,3389,3416,3598,3262,3655,3568,3876,2849,3085
,3178,3470,3253,3402,3377,3636,3122,3428,3509,35
86,3481,
3612,3681,3767,3329,3497,3454,3623,3536,3725,366
1,3789,3571,3688,3744,3825,3717,3808,3893,3933,2
900,319
5,3281,3427,3149,3543,3461,3644,3351,3474,3
595,3674,3508,3696,3748,3840,3232,3561,3527,3703
,360 1,3764,37
19,3836,3652,3736,3798,3821,3781,3909,3882,3958,
3391,3627,3578,3759,3679,3852,3738,3871,3547,380
0,3773,3
890,3786,3901,3923,4045,3619,3843,3827,3938,3813
,3916,3948,3996,3865,3943,3931,4013,3967,4065,40
04,4077,

1623,1783,1910,2233,2006,2277,2357,2658,2066,2487,2327,2788,2422,2696,2840,3070,2134,2377,2549,2728,246
5,2939,2780,3115,2605,2882,2993,3298,2861,3145,3190,3444,2190,2542,2493,2822,2622,2877,2974,3204,2733,30
45,2915,3160,3024,3237,3345,3501,2681,3000,2953,3230,3078,3320,3278,3479,3133,3337,3388,3685,3408,3580,3
550,3758,2298,2566,2716,2938,2821,2978,3174,3261,2645,3006,3092,3300,3030,3375,3309,3528,2806,3120,3147,
3437,3060,3344,3414,3594,3245,3449,3369,3563,3494,3618,3659,3807,2928,3166,3280,3393,3218,3471,3443,363
5,3326,3540,3503,3613,3436,3665,3691,3796,3201,3557,3524,3675,3599,3737,3712,3837,3487,3705,3752,3905,37
80,3881,3860,3979,2437,2841,2694,3077,2768,3274,3047,3409,2950,3114,3207,3399,3184,3366,3466,3641,2924,3
330,3229,3514,3165,3447,3431,3669,3306,3489,3565,3621,3539,3698,3722,3829,3022,3255,3352,3476,3383,3590,
3532,3742,3267,3518,3630,3714,3562,3689,3771,3853,3410,3614,3589,3727,3671,3802,3754,3873,3657,3778,383
4,3888,3812,3912,3920,4019,3129,3420,3310,3577,3365,3548,3624,3762,3445,3694,3606,3747,3647,3785,3799,38
94,3486,3676,3637,3809,3726,3792,3841,3956,3706,3863,3816,3908,3854,3930,3945,3994,3526,3643,3739,3828,3
690,3838,3870,3925,3775,3900,3850,3942,3889,3951,3969,4011,3760,3874,3902,3987,3922,3960,3974,4033,3858,
3981,3998,4026,4005,4039,4052,4082,2610,2881,2817,3221,2982,3271,3193,3463,3034,3158,3368,3592,3321,349
6,3555,3707,3081,3342,3293,3516,3429,3660,3541,3733,3407,3569,3615,3784,3642,3753,3817,3904,3175,3440,33
90,3579,3480,3604,3620,3763,3346,3634,3680,3820,3718,3805,3794,3915,3522,3683,3740,3791,3709,3835,3855,3
936,3668,3866,3830,3927,3884,3953,3966,4021,3252,3378,3534,3678,3467,3653,3731,3823,3588,3769,3699,3806,
3574,3842,3859,3941,3610,3720,3745,3907,3774,3851,3878,3990,3801,3898,3867,3950,3919,3961,3984,4029,364
9,3750,3824,3879,3783,3928,3899,3971,3847,3891,3937,3977,3911,4009,3992,4036,3811,3926,3949,3995,3962,40
16,4006,4049,3944,4001,4027,4057,4020,4043,4061,4085,3398,3500,3556,3724,3632,3797,3713,3864,3603,3755,3
749,3895,3788,3914,3885,3983,3672,3833,3779,3880,3849,3903,3939,3976,3822,3929,3947,3993,3921,4002,4015,
4048,3702,3804,3872,3917,3839,3952,3932,3999,3857,3940,3959,4031,3980,4007,4010,4056,3897,3973,3989,401
4,3968,4037,4022,4054,3954,4025,4042,4069,4035,4060,4067,4091,3766,3862,3883,3972,3918,3946,3988,4017,39
06,3957,3978,4023,3997,4040,4032,4063,3935,3985,4000,4038,4008,4028,4047,4073,4012,4051,4044,4066,4055,4
071,4075,4094,3963,4003,4018,4046,4024,4050,4059,4070,4034,4058,4053,4078,4064,4079,4074,4090,4041,4062,
4068,4080,4072,4081,4083,4087,4076,4084,4086,4089,4088,4095,4092,4093]

**Sequence group 6: Q6_8192**

[0,1,2,4,8,16,32,3,5,64,9,6,17,10,18,128,12,33,65,20,256,34,24,36,7,129,66,512,11,40,68,130,19,13,48,1
4,72,257,21,132,35,258,26,513,80,37,25,22,136,260,264,38,514,96,67,41,144,28,69,42,516,49,74,272,160,1026,520 ,288,528,192,544,70,44,131,81,50,73,15,320,133,52,23,134,384,76,137,82,56,27,97,39,259,84,138,145,261,29,43,9
8,515,88,140,30,146,1028,71,262,265,161,576,45,100,640,1025,51,148,46,75,266,273,517,104,162,53,193,1032,15
2,77,164,768,2048,2049,268,274,518,54,83,57,521,112,1024,135,78,289,194,85,276,522,58,168,139,99,86,60,280,8
9,290,529,524,196,141,1040,101,147,176,142,530,321,31,200,90,1056,545,292,322,532,263,149,102,105,304,296,1
030,163,92,1033,47,267,385,546,324,208,386,150,153,165,106,55,328,1088,536,577,548,1034,113,154,79,269,205
0,2052,108,578,224,166,519,552,195,270,1041,641,1036,523,275,580,291,59,2056,2064,169,560,114,277,156,87,1
152,197,116,170,61,1042,531,525,642,281,278,526,177,293,388,1057,2080,2051,91,584,769,198,172,120,201,336,
4096,4097,4098,4100,62,282,143,1029,1044,103,178,294,93,1058,644,202,592,323,392,297,2053,2112,770,107,18
0,1280,151,209,284,1027,648,94,204,298,400,608,1089,352,325,533,155,210,305,547,300,109,1048,184,534,1060,
537,115,1090,167,225,326,306,772,157,656,329,110,2057,2054,117,212,171,1038,776,1064,330,1153,226,549,104
3,538,387,308,216,416,271,279,2065,2058,158,337,550,672,1092,118,332,579,540,1072,389,173,1037,121,553,199 ,784,179,228,338,2066,2176,312,1536,704,1154,2060,2081,390,174,554,581,1046,393,283,122,44

8,353,561,1096,2 03,63,340,394,1049,1281,527,582,556,181,295,1059, 285,232,2113,2068,124,205,182,643,1156,562,2304,2 082,286, 585,299,354,1045,211,401,1104,4104,4112,4128,409 9,185,1061,396,344,586,645,1282,593,535,240,1050, 206,95,3 27,564,800,2072,2084,402,356,2055,2177,307,301,41 7,1160,213,1066,568,1120,832,588,4101,4160,4105,4 102,103 5,1537,186,646,404,1091,227,896,594,418,302,649,2 114,2560,771,360,539,111,1052,331,1168,214,2059,2 088,309, 1062,1284,188,449,1073,217,408,609,596,551,650,22 9,159,420,310,1093,541,2116,2178,4113,4106,4114,4 224,128 8,773,610,657,333,1065,119,1098,600,339,1184,218, 368,652,1031,230,391,313,450,542,1538,334,2067,20 61,2096, 2062,1076,233,555,774,175,123,1155,658,2120,2305, 612,341,777,220,314,1105,424,1068,395,673,583,355 ,4108,4 129,4161,4116,1296,1094,287,183,234,1051,2069,21 80,125,557,1216,660,616,342,2083,2306,316,1157,24 1,778,56 3,1074,345,452,397,403,1112,207,2074,2561,1540,67 4,558,785,1100,432,1039,357,187,1162,236,664,1312 ,624,58 7,780,1080,1122,2128,2085,705,126,242,1063,2073,2 070,565,398,346,456,2184,2308,358,405,303,569,154 4,244,1 158,1097,595,1283,189,566,676,1169,1054,1108,361, 706,4352,4130,4120,4132,589,1344,215,786,647,348, 2312,20 86,419,406,2562,2144,464,680,2115,2089,801,1069,3 62,1164,2192,2076,590,409,1286,570,1121,788,1552, 1106,59 7,1075,572,1186,219,311,4103,4225,4162,4608,708,5 98,1289,601,651,421,792,802,2117,2090,611,1047,60 2,1172, 410,231,688,653,2564,2097,1128,248,1070,369,2122, 2320,190,364,1568,654,1095,659,1161,335,480,315,2 21,370, 1285,613,4107,4136,4164,4226,1408,422,2208,3074, 425,451,2568,2336,4115,4109,4144,4110,1077,614,5 43,1298, 235,412,343,372,2576,2240,1185,775,317,1539,222,1 099,426,453,237,1124,559,1170,2592,2118,1292,833, 804,712 ,1082,834,661,1053,2092,2179,2129,2098,80 8,779,1217,617,604,1541,433,720,816,1101,2121,206 3,1176,836,347, 897,4168,4353,4117,4228,1136,243,1297,662,1600,4 54,318,675,2368,2181,1110,618,4131,4354,4122,460 9,1081,8 98,781,1314,1220,376,428,1546,2100,2071,665,736,5 67,1107,2182,2432,1192,1078,2124,2185,840,625,23 8,1159,3 59,457,399,787,2130,2104,591,678,434,677,1290,154

2,2075,2145,349,1300,1102,245,1188,458,666,1113,6 20,1553 ,4176,4133,4121,4118,1163,1313,363,127,42 32,4356,4360,4134,1067,191,1125,782,407,436,2087, 2307,626,1218,2 132,2186,571,465,2193,2309,681,246,707,1346,2077, 2091,2146,2563,350,1084,599,668,1548,790,2136,21 88,1165, 1320,460,1123,1200,249,682,1664,573,1171,411,803, 4610,4192,4163,4137,1116,789,1304,709,365,440,62 8,689,20 78,2194,374,1224,3076,2119,423,1556,4240,4124,41 65,4138,466,793,2310,2313,2209,2624,1130,250,371, 1174,20 93,2148,481,574,1348,413,1109,603,366,1545,1287,1 055,468,1570,655,900,805,615,1166,684,1409,710,26 88,3073 ,1187,429,4612,4145,4170,4368,2099,2196,7 94,252,1114,373,605,1232,848,690,2094,2123,713,63 2,2314,2321,131 6,482,806,1132,2565,2152,1083,427,1177,904,1569,4 14,2210,2101,1291,223,1126,1554,663,692,835,1328, 619,472 ,2241,3080,1137,455,4256,5122,4616,4384,4 624,4288,4640,4166,2200,2125,796,1189,1601,809,7 14,1248,721,837, 716,1086,2212,2816,1302,1352,4140,4227,4177,4146 ,864,810,1173,606,1194,912,1103,722,696,377,2316, 2322,14 24,435,2566,2102,1293,1560,817,1129,1792,319,621, 1180,2131,2105,2569,2160,812,484,1345,430,1572,1 138,307 2,2183,4169,4111,4416,4229,1299,838,667,1219,212 6,2337,488,1111,239,378,459,622,4148,4119,4230,44 80,1410, 627,2242,2133,437,380,1201,1608,818,1178,2324,25 70,1294,461,1543,496,669,1190,1317,679,2106,2216, 1140,10 79,4172,4233,4178,4152,2187,2147,1221,724,841,13 05,629,1584,2134,2108,351,467,2328,2137,1360,438, 1115,73 7,2338,2577,251,462,442,441,2572,2244,1666,469,15 49,247,683,1196,2189,3088,2149,2195,4123,4193,41 35,4355, 1226,842,1412,1127,738,1144,2224,2190,4180,4234, 4241,4357,1308,899,1602,670,1318,783,1085,849,41 25,4139, 4194,4611,1555,1193,820,1576,728,928,791,367,257 8,2369,1376,901,2079,2248,2138,3104,1233,630,259 3,2340,1 321,685,844,1204,633,711,2370,2580,2311,2197,215 0,2153,1118,253,691,1301,824,1175,2352,2344,902,6 86,1668, 1222,1416,1133,740,1347,4184,4236,4126,4242,850, 375,1558,444,5124,4167,4358,4361,1306,470,1167,4 83,4257, 4672,4141,4196,1547,415,3078,2211,485,905,2140,3 081,4736,5121,4147,4244,1202,795,473,1240,2095,2 315,634, 744,2433,2594,1616,852,2372,2256,2434,2198,960,1 322,2201,2213,865,693,2154,2103,1131,1794,1350,7

97,1225,
1604,1571,906,2376,3136,1252,715,1141,1330,807,474,636,1179,694,254,4142,4171,4362,4369,1550,1665,2584,2625,717,1071,2596,3082,1315,575,913,1440,798,811,379,1208,4613,4200,4258,4149,2161,2202,1353,1191,2127,2317,697,1564,4289,5128,4248,4173,431,1142,607,1228,2156,2626,489,1324,2272,2214,866,723,2567,2600,486,1573,1181,1234,908,1793,1561,718,813,1364,2243,2318,476,856,3089,2689,1117,1411,4260,4864,6144,6145,839,1329,1295,1146,4364,4370,4614,4150,3084,2571,725,698,1472,914,2323,2628,1249,752,868,819,1349,814,439,929,4179,4153,4617,4208,2339,2107,1197,1578,490,1139,2217,2608,1680,623,2162,2325,1632,1336,671,1198,1362,739 ,2204,2135,1603,1557,3200,2245,5120,4231,4174,4385,2164,2218,1413,916,1303,463,1236,843,2109,3090,1135,381,1672,1354,2579,2573,4290,4181,4372,4618,4154,4264,4235,4195,497,1586,930,821,2690,2329,726,961,1203,1182,2326,2574,872,1418,492,1250,1332,631,2225,2341,4182,4156,4376,4185,2436,3105,1574,1223,729,1145,1605 ,700,2139,2632,1796,443,2817,2246,1307,741,2220,2168,1378,1562,1356,1205,845,1319,4386,4625,4620,4292,2249,2384,920,382,2110,2330,1585,822,1425,851,2191,3077,3092,2151,1229,730,1609,498,2226,2342,4237,5136,4197,4243,880,1256,742,445,1392,471,2141,3106,4272,4238,4626,4417,2692,2250,2640,2371,4127,4296,4186,5152,
635,1148,1696,932,1580,687,2440,2345,1210,1420,1612,1325,1800,903,1134,825,4641,4388,4418,4628,1235,1361 ,500,1577,846,1670,1195,745,2818,2155,2228,3328,4359,4245,4198,4201,826,732,2199,2257,2332,3075,1264,446,
2696,2142,962,1426,1620,936,2252,2346,1377,475,2448,2656,3137,2400,2373,2581,853,1310,867,637,2203,2258,
1551,1230,2353,2595,1414,907,1206,1667,1588,1333,4400,4392,5126,4259,487,1808,2348,2157,4188,5129,4143,4363,695,1441,1087,746,4481,4642,4420,4304,828,753,1610,854,1237,1326,3096,2232,4482,4246,4249,4261,4202,
4151,4424,5184,857,1368,2582,3108,1209,504,799,1355,2585,2163,255,964,4632,4673,4644,5130,3138,2215,2273 ,2374,1242,909,2354,2820,2205,2704,1673,1559,1309,719,2377,2158,1143,477,2165,2260,1617,915,1448,1380,2219,3086,638,748,2824,3112,944,1728,1331,1227,869,1592,1428,491,699,1253,4209,4250,4175,4365,1351,754,2378,3201,6146,6148,4204,4674,1183,1565,2274,2597,858,1618,1417,1476,4320,4262,4615,4648,4291,4366,5137,4737,3091,2586,478,968,1260,383,2435,2356,5132,4619,4371,4676,1212,910,1801,815,2264,2464,1579,976,2319,2327,870,1684,1633,917,2206,2385,2598,2720,3140,2166,1337,1241,2380,2627,1606,1824,727,1150,1442,493,1357,1251,2588,3120,1676,873,2437,2221,1384,701,4387,4155,6152,6160,3085,2169,1566,931,4265,4656,4210,4373,1323,1798,1365,1473,2601,2247,756,1334,860,499,2832,2227,731,1648,1238,823,4252,4183,5248,4293,1575,922,1199,1674,4212,4266,4157,5138,2276,2386,874,1432,1421,918,2360,3584,4627,4621,4738,4377,2752,3202,1636,1254 ,2438,2222,502,1795,2602,2629,933,1366,4374,4622,4273,4389,3094,2441,1338,1682,2331,2170,2496,2401,1587,
1211,1488,743,1358,760,2609,3144,1244,1581,881,1147,4484,5153,6176,6147,2251,2111,494,1379,4187,4680,4865,4294,1272,702,2388,2442,3097,3329,921,1624,501,876,2575,2630,1415,847,1856,1444,992,1697,2604,2229,4268,4216,4297,4432,2343,3107,2333,2280,447,1607,1436,1369,2172,2253,1257,1704,2230,2691,733,1797,3204,2610 ,1669,1340,1231,827,1590,934,4158,4378,4239,5125,2334,2633,1634,1474,5140,4199,4274,4390,2347,2402,3093,
2259,882,937,2449,3152,2233,3109,963,1419,747,1265,2444,2392,4189,5154,4740,4298,4688,4419,4488,4393,1119,505,1381,855,2634,2693,924,1810,3330,2641,2583,2288,6149,6208,4866,4203,3098,2254,734,829,1563,1213,2143,2375,4276,5376,4247,4305,1611,1363,2612,2848,1430,1258,1688,1386,965,1614,1730,1239,2450,2404,938,884 ,4380,5123,4744,4190,506,1327,1589,1804,
2355,2349,2465,3208,749,1370,2261,3114,4300,4394,4496,4704,2616,
3168,1640,945,2880,2636,966,1456,1681,755,3083,3585,2234,2694,1266,859,5185,4448,4421,4629,2452,3139,2275,2944,4251,4306,4401,4643,2642,2466,1427,1593,1388,940,2350,2697,1214,830,2819,2408,4396,4205,5144,4280 ,1809,911,1621,1582,4630,5156,4633,4211,2587,2159,1832,871,3100,2379,639,1480,5186,4263,4321,4422,1698,1335,888,1372,1245,479,1422,1268,4402,4868,4253,4752,3216,2262,946,1732,2357,3110,1677,750,1802,1626,3332 ,2236,4425,4206,6153,6150,4213,4308,4267,5134,2497,3121,1393,969,2265,2456,2657,2644,508,1613,2599,2698,
4872,5160,4426,5249,2277,2207,861,1446,2468,2358,1857,1339,3141,2589,757,1382,3336,2821,970,1700,2658,2705,2381,3113,1243,919,2167,3146,1594,1433,1826,1

504,875,1635,1259,862,4322,4645,5139,4634,2648,2387,1920 ,1675,4483,4404,4312,4512,4367,4375,6161,6154,3232,2266,1445,758,4254,4433,4646,4768,2416,2700,1149,948,
1359,1816,3079,2278,1596,1671,1712,977,5188,4214,4428,4675,4636,5168,4485,4269,5133,4217,4649,4295,2439,
2361,1385,923,1622,972,2498,2590,1434,1311,3586,2382,4880,4275,4324,4434,1729,761,1396,877,3124,2281,260
3,2822,2223,2171,3203,2706,1207,1475,2660,2389,1449,1812,952,1686,2825,2268,495,1262,2362,3153,1644,1619 ,2472,3116,1341,1429,2443,2721,1825,703,6162,6272,4408,5632,1371,1638,1567,1736,4800,5250,6156,6177,2631 ,2403,935,1685,978,1625,3344,3142,4486,4270,4650,4677,883,762,1246,503,5142,4489,4379,4218,2335,2231,145
8,925,4544,4449,4657,5192,4299,4159,4436,4490,1394,1269,2282,3099,5145,5377,4623,4678,878,1478,735,1799,
4652,4277,4391,5155,2173,2605,3264,2708,2664,2390,1678,1860,2364,3205,2289,2826,2611,3122,1443,1637,438
1,4328,6209,6164,2393,2500,1481,1373,2445,2451,3160,2255,1699,1255,993,1591,1828,1452,3588,2722,885,939,
994,1400,2606,2833,3148,2480,4220,4301,4278,4739,1744,1656,3087,2405,5252,4658,6400,6178,2235,3210,980,1
689,926,764,2284,2712,1270,941,1628,1367,1805,1457,3360,2672,4382,4681,4395,4450,2635,2828,3128,3170,514
1,4307,4497,5200,1921,1583,2753,2174,1387,1642,2290,3111,967,1267,2613,2446,4281,5157,4492,4440,1484,145
0,2394,2504,4682,4741,5378,4689,886,831,1683,1342,4631,4336,5146,4302,1811,947,2406,2453,2351,2617,3592,
2292,1705,1431,3206,3145,2643,3331,507,1261,1840,889,2237,2614,4191,4423,4660,4896,1650,984,1760,1490,61
68,6180,4498,4452,2724,3217,3102,3156,1615,751,2409,2754,2637,3392,2263,2834,6151,6273,4403,4397,1702,94
2,1858,1423,2695,2396,1460,1383,4513,5256,4309,5162,2467,2454,996,1692,1641,1814,971,1477,2512,2728,1273 ,1512,1733,890,1598,1374,4664,5216,4928,4684,2849,3117,2410,3212,509,1806,2638,2457,5131,5633,4282,4742,
3334,2618,1922,1649,4500,5187,4323,4992,3169,2836,3600,3154,949,973,2645,3123,2620,3234,1397,1489,4690,4
514,4398,4745,2267,2359,2756,2646,6210,6656,4867,4456,4635,4207,5148,4427,3337,2649,1708,1627,2699,2469,
1000,1690,2840,2850,892,1274,5264,4310,6155,6184,2659,3095,1438,1817,2650,3220,2458,2279,4405,5158,5380,
4284,1390,1464,2736,2701,1868,950,1151,1731,4545,5169,4313,4504,1506,1827,1597,863,3176,2296,3118,2417,4
705,4692,4647,4746,1451,759,2238,2412,1864,1714,3616,2702,3143,2707,1701,1395,4325,4255,4516,4406,5189,4
637,6212,6274,3209,2383,2528,2363,1803,1008,2269,2418,3333,2661,1623,1482,5384,4869,4706,4753,3456,2470,
1276,510,4429,5161,4215,5194,2473,2499,1435,1652,4696,4435,5280,4314,3125,2662,2591,3346,2283,2460,2391,
2420,979,1492,3233,2823,4464,4748,5127,4326,953,1928,1829,1389,4487,4409,4546,4638,2365,3587,1738,763,22
70,3147,1872,974,5634,4430,6163,6157,6192,6158,5172,4329,2474,2501,1453,1643,2285,3172,1713,1818,4651,48
70,4271,4219,1215,1402,2607,3218,1629,1520,1830,1691,3340,2881,954,1459,5251,4754,6216,6401,4708,4437,48
73,4316,4410,5201,4520,5164,1734,879,2852,2760,3130,2882,981,1505,2709,3101,1706,982,4491,4769,4679,4451 ,2856,2827,3265,2665,2652,3589,2481,2768,2864,3149,1924,927,3224,2884,1833,1639,2395,2945,3184,2291,1447 ,1746,3345,2710,1343,1679,3648,2502,2366,2723,1820,1761,5392,5190,4383,4279,4330,5147,6165,6276,1479,127
5,995,1740,4221,4653,5312,4756,4712,4438,6179,6402,3158,2666,1401,1888,4412,5253,4337,4874,765,956,3129,
2946,2829,3362,1496,1861,4659,5170,4441,4548,3268,2424,887,1437,4493,4499,5208,4303,6170,6657,5636,4770,
4654,4881,5196,4528,985,1720,2476,3594,997,1630,1813,1462,5135,4453,4283,5258,2713,2784,2615,3155,4332,4
760,5408,4720,3240,3126,1398,1645,2888,2673,2286,3207,2407,2505,2447,2835,1848,1687,2639,2726,4683,4876,
5176,5218,1247,1716,2482,2725,3338,3590,1936,986,1483,1651,1745,943,2397,3348,1859,1508,3150,2293,3236,2
506,6224,6181,4801,4222,1834,1454,2714,3161,4338,5159,6169,6166,2668,3601,891,1841,998,1595,3211,3361,46
61,4494,4442,4552,1278,766,1465,1709,6280,6404,4454,4501,4399,4665,5640,4340,2411,2175,1764,1646,5254,51
93,4691,5379,4285,4662,4772,5265,3115,2239,3173,2830,2455,2484,1737,511,5150,5204,4457,4802,2674,3266,14
85,1404,4685,5440,4311,4882,2619,2513,1693,1866,2729,2294,2755,3394,4743,4444,6408,6182,1952,1491,988,16
57,4515,4502,6658,6240,1752,1807,2398,3132,2647,2716,3596,2838,1399,1844,3213,3368,2508,3171,1001,951,16 54,1926,3248,2297,2730,3712,1707,1391,4560,4776,6211,6185,2621,3219,2459,2851,4897,5165,4458,5260,1002,1468,3164,2837,3352,2757,2413,2488,6288,6172,4686,4505,1836,1494,1873,1271,2676,2737,1694,893,5382,4666,5217,4884,2422,3272,1923,1461,2471,3604,1748,1715,5648,5202,4693,5171,2514,2841,975,1862,4668,5282,4315,4407,894,1815,3178,2298,2419,3222,1497,1653,4804,4694,5385,4697,4747,4517,4888,4898,6213,6186,4707,5143,2529,2622,3396,2461,4698,5268,4506,4327,3157,2651,2414,3593,1510,1762,3335,3103,2516,3618,1842,1375,2703,2948,2853,2663,4784,4749,6660,6193,3214,2732,1703,1009,5224,4344,5166,4465,3457,2758,1466,1874,6218,6416,4286,4460,3235,2477,955,1739,2842,2300,3162,2421,2653,3280,2896,2738,5664,4750,5191,4755,1486,1930,2761,2680,1889,1004,1658,1821,5257,4431,4576,4411,1718,1929,3364,2530,2854,3180,1599,1507,3131,2475,1776,1405,3225,2952,3617,2462,4317,4466,5381,4709,1735,1831,3339,2271,3174,3602,1493,1010,5504,4518,6304,7170,4521,4547,6664,6432,2711,2740,2883,3376,5173,4710,4639,5394,1984,1455,2667,2520,4331,4508,4439,4468,957,1865,3185,2503,6672,6336,5281,4871,2844,3237,3649,2857,4413,5635,4318,5195,4522,4549,4333,5220,2762,3296,2769,2885,2764,3134,983,1710,3350,3400,958,1514,4655,5266,6688,6214,2912,2858,3221,2654,1876,1768,3242,2960,5388,4929,4900,4808,1721,1938,3151,2770,2744,2425,1660,1500,5178,4930,4757,5149,6188,6275,6225,6194,1403,1892,3472,2483,1819,1741,1516,987,4904,4875,5313,4713,3341,3608,1932,1463,2865,3177,3840,2367,1012,1843,2669,3228,4700,5637,4529,4816,4912,5197,6217,6159,5272,4932,4443,4993,1749,999,2860,2532,3393,2478,3620,3186,5232,4339,5393,4758,3347,2886,2715,3267,5696,4550,4414,4771,1838,1277,2536,3159,6464,6277,5206,4714,2287,2426,2507,2670,3458,2675,1647,1925,2485,2428,1498,1742,5177,4994,4877,5410,3249,3656,2866,3226,5316,4472,4524,5642,6196,6167,4761,4832,1513,1880,1717,1016,4663,5203,6278,6528,5288,5174,6220,6281,1953,1837,3342,2509,1867,1631,3591,2544,4936,4721,4334,5255,2717,3238,1469,1747,3365,2727,767,1904,4455,4553,4495,4883,1724,1524,3188,3127,6226,6200,4687,4774,4530,4773,5386,5638,6171,6241,4445,5396,989,1406,1754,1822,3269,2772,2889,3353,5198,4341,5284,4554,2677,3632,2399,2515,4762,5209,4716,5649,3408,2486,3163,2785,2299,2510,2490,2489,1835,1499,3714,2517,3597,2295,2731,3244,5259,5409,4459,4223,1944,1863,1890,1467,1003,1522,3274,2890,3460,3175,2786,3192,5163,4287,5221,4878,4503,4532,6183,6403,1763,1695,3356,2947,4722,5314,6228,6282,4667,4561,6289,6405,3650,2718,1850,990,4777,4342,4803,5442,1005,1937,3366,2831,3133,2897,1722,1845,6173,6187,6242,6659,4446,5180,4695,4764,3603,3241,1495,1655,5644,4886,6232,6284,5261,5416,4556,5219,5296,4345,4778,5760,2868,3624,2776,2976,2839,2415,1765,1956,4669,5267,4507,4899,3424,2949,1487,1750,5212,4885,5400,4805,3281,2678,1869,1521,3369,2733,2892,3252,4461,4536,4724,4785,2681,2759,959,1896,6174,6290,4470,5320,1263,1940,3166,2301,2739,3349,2872,3223,1770,1877,2950,2734,3716,3270,1509,1711,3464,3181,2788,3395,7172,6215,4519,5652,1756,1846,2898,2423,4562,4889,6406,6409,3606,2492,1011,1960,3354,2518,3215,2531,6305,6720,5226,4346,4467,5270,6189,6244,3595,2463,1784,1870,4577,4670,5444,4509,5205,4699,4462,5641,1662,1013,2533,2953,5383,5151,4564,5666,4751,4996,4901,4711,1985,1753,3250,2843,5262,4780,5505,4806,2521,3288,2682,2792,6784,7169,5283,4525,1927,1528,3664,2900,6195,6292,4890,4348,1849,1882,3008,3370,5210,4469,4701,5328,4944,4786,6190,6219,2913,2741,1766,1511,4809,4728,6410,6417,3179,3842,3398,2845,3273,3652,3619,2954,1954,1719,3300,2763,3189,3378,1777,895,5412,4578,4902,5228,2855,2522,2684,3227,6661,6248,5179,4523,2742,2302,1439,1006,5273,5000,5665,4510,3598,3713,1878,1891,2765,3119,3363,2623,6306,6197,5387,4319,2961,3488,2846,2859,2427,3256,1939,1661,5222,5650,4759,4788,3401,3239,1502,1986,2745,3612,1852,1934,4931,5424,4715,4568,2479,3190,2655,3276,6337,7176,5233,4551,2537,3372,1723,1772,2914,2771,1515,1897,6296,6221,4892,5285,5697,4905,4810,5344,4817,4933,4812,5182,6308,6912,5398,5448,2534,3621,3229,3282,4960,4906,5269,4702,2956,3841,3609,2766,1014,1470,2861,3412,5290,5008,5199,4818,1743,1931,2524,290

4,4792,4
473,6412,6418,3165,3459,2887,3377,5520,4531,6662,6198,3343,3194,2773,2746,5389,5656,4913,5225,3520,2962,
1017,1968,3297,2800,2916,2867,3397,2862,2487,2977,5888,4415,4717,5276,1881,1894,3245,3626,1769,1517,253
8,3187,6227,6201,6665,6256,1778,1941,1823,1659,3728,2671,1992,1875,4908,4580,5441,4526,3680,3384,1755,15
01,2719,3246,3410,2787,5668,5234,7168,6279,1018,1900,3651,3605,1725,991,3461,2964,5395,4934,4763,5315,62
22,6433,4584,5207,4335,4474,4555,4718,3351,2511,3284,2891,5506,4723,6338,6229,4533,4476,5297,5704,4914,5
274,6420,6666,3183,2429,3720,3402,5390,4557,5639,4592,2545,3634,2978,2869,4765,5286,5413,4775,6202,6312,
5236,5175,2774,3009,3251,3230,1933,1839,2920,3466,2540,3298,3380,2679,6283,6243,5317,4820,1525,1955,198
8,1884,1726,1948,3622,3271,4937,5401,4725,5680,6230,6204,4447,4563,2777,3193,3653,2748,6424,6233,5456,45
34,5211,4833,6434,6673,1780,1518,3844,2491,1020,1767,1905,1851,4347,4558,4538,4537,3355,2789,1893,1945,3
426,3610,3404,3253,2893,3367,2968,2430,6668,6340,5762,4565,5645,4343,4779,5292,6285,7184,6245,6291,3633,
2870,3473,2899,5322,4938,5508,5223,3277,2778,3657,2546,4834,5240,6320,6286,1757,1530,2928,3304,5404,499
5,5698,4766,2790,2493,3440,2519,5414,4879,5181,4945,1958,1471,1007,2000,2683,3196,3744,2980,3628,2735,18
47,1898,5651,5289,4916,5672,4824,5024,4887,4463,6674,6465,5472,4997,3258,3468,3660,3373,6175,6344,6234,7
200,5329,4726,6689,6436,1523,1942,3848,2951,3182,2873,1961,1871,5417,4781,4940,5300,3283,3409,1771,1529,
2548,3625,2894,3718,4729,4807,6466,6676,6407,6293,6246,6249,3243,2793,1912,1758,5214,4349,4787,5397,492
0,5271,6448,6440,4998,4782,5764,5318,2874,2780,1989,1946,3312,2494,3010,3474,5512,5229,4836,5443,3668,29
84,3425,2523,4946,4471,5654,4540,1526,1906,2901,3358,2915,2685,3599,3278,1883,1773,3462,2955,5402,4566,5
263,4579,3254,3715,3636,3381,2535,3856,1957,1853,2743,3489,3135,2794,5643,4511,7174,6307,4581,5001,6236,
7177,1976,1015,2876,2801,5298,4891,4569,5336,6191,6411,4730,4840,3658,2902,3285,3374,6529,6690,5712,494
8,6468,6352,6530,6294,1751,1993,1503,1962,5056,5418,6297,6309,4961,4789,6250,6199,2905,3416,3257,2552,52
27,5890,5446,4893,5321,5700,5667,5002,6472,7232,5348,4811,2847,3403,2303,3012,5237,5426,4903,4570,1781,1
885,3290,2957,4732,5275,4790,4350,1908,2016,3721,3607,5646,5761,6680,6721,3357,2767,3191,2525,4813,5167,
6692,7178,5411,4671,5009,5536,3665,2963,3496,3428,4894,4907,4475,5304,2686,2796,1854,1532,2992,3776,337
9,3275,2917,3640,3476,2539,2747,3301,1972,1774,6257,6298,5449,5287,6223,6413,4793,5660,3399,2802,1019,18
95,4527,5238,4703,5324,3231,3613,2906,3666,6252,6722,4585,5420,6368,6310,4962,4819,3465,3524,2526,3016,6
663,6696,4582,5669,5277,5330,5004,5889,3308,2431,1987,1969,5657,4814,4909,5460,6339,6414,4572,4952,3260,
2958,3849,2863,7185,6785,5213,5507,3627,3024,1782,1279,4935,5425,5391,5242,2918,3732,3681,2965,7180,666
7,4821,4794,5568,5010,6419,6724,5345,4848,4964,4915,5445,4910,4535,5025,1943,1899,3385,3289,6435,6203,52
93,5674,1994,1663,3654,3872,2775,3198,3490,2541,4586,5235,6313,6704,3405,3299,1964,1785,5776,4719,6258,6
421,3724,2921,1021,1935,5728,5432,4767,5294,3432,2749,3614,2979,5458,4835,6300,6231,3371,3846,3413,3521,
2804,3382,2908,2547,5699,5653,7296,6341,2779,3696,3286,2871,3623,2970,3247,3722,6260,6314,5509,5012,188
6,2001,2922,3480,3469,2966,1407,1779,5399,4559,5332,4939,6205,7186,5231,4477,1990,1970,3684,3302,5768,54
50,6675,6669,2550,3843,1879,1022,4593,5682,5026,4917,6786,6425,4822,5057,5299,5278,6422,6670,4968,5514,4
588,5346,5428,4727,6321,6437,2981,3414,1902,1947,6532,7201,5670,5319,3386,3730,3635,3259,4825,5241,5701,
4796,6235,6728,5892,4539,3536,2791,3406,2808,6913,6342,5403,4837,3292,3629,2929,3195,6316,6264,5474,565
8,5452,5301,4941,5415,2542,3427,3320,2750,2969,3672,2549,2924,1759,1907,3463,2895,6345,6480,5016,4478,39
04,3492,3040,3745,1527,1996,1786,1959,6206,6426,5681,4918,5521,4947,6287,7173,2495,3655,3484,3417,7188,6
247,5325,4826,2002,1913,3305,3752,1949,2017,2781,3845,5705,4594,6322,6438,1534,1788,3717,3388,3279,2875,
3638,2982,4976,5352,4838,4541,5488,4567,6237,720

2,6788,6346,6736,6467,3682,3522,2930,2985,4731,5244,579
2,5028,5676,4783,6536,6441,5306,5516,5708,5421,5896,4999,5230,4921,3011,3467,2795,3313,5331,5457,4596,56
73,3167,2553,3429,2903,4942,5766,5291,4841,6914,6251,6324,7424,2972,3858,1910,1965,2782,2877,3611,3261,3
659,3411,2004,1901,4922,4828,6295,6353,3478,3306,3736,3434,6428,7171,5360,4542,6792,6238,5058,5522,3013,
3662,3778,3287,5716,5032,6348,6442,5473,4571,6544,6752,1966,1775,2986,2932,2008,1531,2554,3375,7233,649
6,6469,6677,3637,3852,1971,1950,2797,3418,3688,2993,4949,5406,4963,4733,3014,3504,3729,2803,6299,6354,56
47,5326,6449,6691,5510,5003,5302,5763,5684,5429,3314,2907,1909,1991,4583,5904,6444,6253,3475,3641,3436,2
988,4791,5537,5183,4842,3262,2878,3857,2959,4924,4849,5706,4950,5333,5422,7192,6328,3669,3630,3880,2919,
2018,1727,2687,3528,3746,3383,2936,3420,4953,5464,6678,7204,5305,4600,4895,5451,6681,6259,4351,5060,329
3,2527,3470,3316,7234,6311,6369,6470,5338,5005,6450,6916,1916,1855,1974,1995,2994,3780,3725,2798,6301,68
00,5769,5655,5405,4815,6473,6254,3850,3674,3441,3017,5239,4573,6261,6356,5713,5011,5544,5476,2020,1977,2
556,3661,6315,7182,4734,4844,6920,7208,5040,5824,5427,5323,4965,5688,2909,3494,3905,3387,2805,3430,3018,
3748,5524,4587,4795,5349,3291,2967,1787,1914,5447,4850,6474,7297,3642,3481,3874,3552,5279,5661,6370,669
3,2923,3683,3307,2910,4954,5714,5513,5572,2005,1887,3968,3723,1023,1963,3493,2806,7187,6682,4574,5064,53
56,4479,6531,6452,3197,2996,3407,3864,5308,5006,5897,4911,6360,6560,5675,5072,6415,6423,4966,5780,5729,5 0
13,6302,6481,3644,3719,3760,3025,6694,6816,7236,6262,543 3,53 37,6476,6723,3433,2971,3670,3020,5702,5920,
4823,5246,5538,4589,5453,5347,6684,7216,5772,4969,3482,3359,1998,1783,6533,6317,5480,4797,3777,2809,344
4,2925,7181,6265,5662,5027,2024,1980,3255,3523,5419,5894,5461,5569,6697,6343,4852,5430,4956,4595,6928,63
23,4827,5744,5334,4919,3497,3860,3000,3734,5671,5018,5295,5770,2543,3310,1903,1973,3692,3667,3389,3477,3
873,2751,3419,3686,6372,6482,4970,5528,5517,5014,6456,7680,3615,3784,2983,3733,6848,7298,5732,53
50,3026,
3673,2931,2810,6534,6318,4598,5891,6698,6725,5029,5462,3294,2551,3506,2973,7190,6537,5434,5778,6427,626
6,6592,6497,3442,3317,2003,1789,5683,5307,5584,4839,5454,4856,6705,7240,2926,3526,2783,3847,5340,5677,49
77,5243,1997,2032,3726,3908,6347,6207,4590,5475,5368,4798,6484,6538,7193,7425,5017,5720,4597,4972,6671,6
726,5511,4943,5952,5540,5088,5793,6700,6325,1978,1917,3491,3685,6439,7203,6429,6376,2010,1519,3529,3421,
4543,5703,5532,5465,6268,6349,5353,5800,3747,3303,3041,3639,6326,6787,4829,5893,3876,3500,2933,2987,730
0,6706,5765,5436,5327,4923,5686,5030,3042,3448,3792,3704,3028,3737,2974,2812,6430,6729,5730,5570,3318,29
89,3676,3415,3853,3505,2019,2006,6443,6498,7189,6355,3969,3631,3435,3690,4978,5033,6545,7248,6329,7205,5
059,5515,1951,1911,3015,3315,4843,5361,6540,6488,3532,3498,2021,2009,5215,4601,5477,4951,6730,6789,5020,
5906,7426,6737,6679,6384,7194,6350,4830,4925,5659,5309,6239,6471,2934,2879,3731,3390,5707,5459,6708,694
4,5526,5354,5784,5482,5061,5710,5826,5335,6546,6500,5034,4980,3859,2995,3753,3479,4602,5423,5685,5900,25
55,3309,3888,2937,6451,6445,6561,7304,4845,5466,6357,7210,3698,3032,3808,3538,3663,2799,1790,2026,3750,2
990,3906,3471,6712,7264,5736,5041,3508,3431,3044,3740,6976,6732,5062,5552,5777,4851,7179,7681,3689,3862,
3019,3525,6330,6790,5362,4955,1975,2012,3321,3560,3781,2938,3646,3422,6548,7235,6371,7040,1967,1915,255
7,3854,3970,3697,2997,3021,6738,6562,5523,5689,5484,5036,6446,6793,5310,4926,6915,6504,5905,5007,5717,56
78,6683,6255,5928,4967,7196,6475,4735,5576,5794,5431,4984,5468,5341,4575,5518,5364,3445,3537,3756,3675,7
312,6358,5042,5828,6453,7206,5773,4846,5898,5722,7428,6332,3048,3738,2940,3322,3486,3865,3438,3512,2025,
2022,3916,2998,6593,7217,5489,5065,6361,6552,6753,6740,4604,5709,6695,6794,3199,3779,3554,3875,6373,630
3,4957,5542,6564,6454,5953,5435,3645,2911,1981,1918,2033,1999,3499,2807,7237,6685,4853,5478,7432,6917,50
66,5796,3912,3762,3749,3443,6754,6801,6477,7209,3851,3056,3671,3530,5339,5015,6263,7242,5690,5529,5922,5 600,4971,5731,5355,4958,3324,2558,3483,3700,6744,6483,6016,5771,3027,3540,3001,3976,7328,6362,5541,4854, 3877,3437,3786,2811,6512,6796,5245,5044,5455,5912,7175,6374,5692,5767,5808,5073,2028,1533,3920,3022,350 1,3691,3761,3866,6535,6457,5481,5019,5718,5068,6594,6686,5530,5407,7682,6478,3263,3450,3677,3568,5825,48 57,5492,4973,7220,6377,6699,6918,3878,3739,3002,3507,6319,6267,7299,6802,5303,5571,6756,6485,3782,2927,3 029,3553,5545,5908,5048,5782,6921,6364,4591,5358,2011,1982,3754,3030,6458,7249,5740,5715,6568,7212,5437, 5525,6539,6817,5921,4799,3972,2975,3881,3687,3495,3794,2034,1979,5467,5734,5663,5832,3391,3727,3868,380 9,6727,6499,5031,5781,5074,5721,7440,7238,4979,4858,5342,4599,3527,3323,3043,3788,6431,6327,5554,5021,34 49,3936,2813,3004,5490,5365,6378,7195,4974,5574,4831,5895,3544,3909,2935,3485,6269,6701,7360,6804,6760,6 486,5774,5956,6460,7301,6385,6922,6707,7218,5539,5733,3033,3768,3045,3678,6489,6596,5577,5469,6541,6547, 7256,6351,3861,3510,2023,2013,5795,5351,5089,5687,5924,5548,7684,6818,4981,5035,5090,5496,3446,3693,203 6,2007,6702,6929,7244,6576,3896,3735,3295,3764,5840,5752,7183,6501,6331,7306,5076,5785,5022,4860,6380,68 08,5366,5037,5724,5463,5901,5553,7456,6768,3984,3034,3531,3699,6731,6924,7224,7266,3793,2991,3907,3556,6 017,5679,6849,6270,3882,3502,2939,3889,5483,5738,6386,7207,5063,5363,6709,6542,5580,5546,6490,6600,3046, 3643,3326,2814,4982,4927,5779,5438,3513,3757,3812,3694,5907,5043,6502,6549,6447,6713,7688,6388,5801,552 7,7302,7241,6739,7427,4603,5357,2030,2014,3785,2559,5936,4985,6333,6710,3533,3452,3741,3914,5746,5080,58 56,5586,6820,7313,7198,7252,5711,4847,6505,6850,6733,7488,6359,6930,5798,5038,5954,5519,6791,6492,5556,5 479,2040,1535,4000,3539,6563,6550,5092,5788,5737,5910,5067,5573,6608,6824,5369,5608,5829,4986,5694,5470, 3036,3705,3800,3855,6945,7213,6506,7308,3447,3892,3049,2999,4605,5902,6734,6553,3702,3974,3755,3439,305 0,3516,3884,3542,7430,6714,6018,5745,3921,3319,3742,2941,7265,6932,7696,7250,3971,3509,3796,3763,5045,50 69,6741,7219,6716,7330,5493,5585,2027,2029,3023,3910,6363,6455,6852,6742,2942,3863,2035,2037,7433,6745,5 804,5723,6795,6565,5096,5786,6936,6946,4988,5370,6755,7191,5534,5913,6746,7316,6554,6375,5486,5560,6832, 6797,5964,5046,5247,5827,5602,5923,5693,4959,7272,6392,7214,6513,3545,3701,3558,3810,5547,4855,6334,650 8,5960,5810,7712,6798,7239,6803,5797,5491,3890,3423,3751,3057,3514,3922,3003,3787,3534,3978,3937,3052,73 05,6479,6624,6459,5899,5104,6365,6514,7429,6757,5719,5578,3706,3869,3766,3977,7552,6566,5372,4606,1791,2 038,3647,3555,3824,3453,3783,3879,6569,6595,5531,5748,3541,3058,4032,3503,7221,6758,6687,7442,6379,6556, 6487,6516,5075,5588,7329,6919,5049,6024,5925,5485,6461,7683,5834,4859,6366,7243,5968,5070,6570,6597,554 9,5739,6381,7268,5809,5914,3005,3913,3031,3758,5311,5498,6703,7314,5725,5616,5926,5787,7436,6977,5050,55 55,3006,3562,3924,3816,2041,1919,3769,3986,5830,4975,6948,6856,7226,6978,5077,5601,6805,7197,5802,5078,3 708,3548,3451,3940,6952,6923,7361,6761,6748,7685,6577,6864,3867,3789,3564,3035,6960,7245,6020,5023,7320, 6980,5929,5735,3980,3511,3060,3891,6491,7041,7280,6387,3797,3047,3886,3325,5543,5842,7441,6806,5439,577 5,7744,6598,6462,6819,5916,5857,3695,3973,3546,3790,5575,5371,5091,5836,3561,3928,3765,3064,7254,6762,54 97,5984,4861,5052,7225,7042,6925,7458,5592,5957,7364,6520,4983,5533,4001,3885,3915,3679,5081,5816,6572,7 690,5093,5726,5909,5558,6809,6880,6711,7251,3517,3795,2815,3952,7336,7222,5494,5741,6984,6769,6382,7303, 6503,6601,6543,6931,5944,5783,6735,6822,3772,3572,3037,3454,5343,5812,6578,6821,7434,7686,6032,5082,380 2,3870,2042,2039,5579,5747,5841,5039,6493,7444,5955,5604,7246,6389,7332,6602,3883,3547,3992,3911,3938,35 15,3051,3570,5930,5550,6810,7257,6764,7697,4987,5937,5094,5691,7307,7457,5374,4862,5561,5805,3811,3743,3 898,3038,6507,6271,5860,5742,3053,3985,3770,3893,7211,6335,7269,6926,6551,6580,5833,4607,6770,7362,5581, 5500,6715,6609,5789,5962,6825,6390,6851,7490,6048,5587,5084,5753,3543,3703,3813,4004,5848,5903,6494,722 8,6743,6812,7692,6934,5495,5940,7309,7464,6604,7267,5097,5047,5750,6022,7344,6393,3535,3798,3917,3569,68
26,7808,5803,5487,2044,2043,3007,3944,6717,7315,6555,6947,5098,5564,7260,6933,7448,6853,6509,6584,5932,5
590,5969,5367,6772,6833,5790,4989,3311,3988,3818,3925,6518,7368,6019,5557,6567,7700,5844,5811,6610,6937,
5071,5958,3557,3759,3804,3894,4990,5911,7274,6394,6515,7318,5593,5749,3059,4008,3832,3918,6625,6718,749
2,6557,3710,3061,4033,3801,7253,6747,6510,7689,5606,5858,7431,7199,6612,7714,5938,5471,6799,7044,6949,67
59,3975,3576,3897,3930,7310,6828,5799,5105,2031,1983,3814,3559,7553,6854,5562,5970,7331,6573,5051,5835,6
938,6396,7258,6517,6749,7376,6992,6834,5582,6026,6857,6776,5985,5100,5754,5917,5814,6025,7460,6626,6950,
7276,5695,5603,7227,6571,5872,5501,7321,7048,7713,6558,4002,3767,3825,2943,5831,5927,7435,6367,7270,769
8,5589,5106,3487,3054,3926,3939,3987,3709,3550,4034,6807,6836,6979,7472,6080,5551,6763,6616,3900,3982,20
46,2047,5053,5961,7281,6599,3771,3820,3563,3945,6940,7333,7745,6953,6858,7392,6865,6981,6860,7230,5079,5
806,7446,7496,5054,5610,7008,6954,7317,6750,5972,5864,7338,7056,5817,6034,7247,6866,6840,6521,5756,5596,
5499,5988,7568,6579,5915,5837,5612,5083,3062,3518,3791,3979,7437,7704,6028,5559,6961,7273,7936,6463,510
8,5939,6765,7324,3065,4016,3929,3942,3817,3565,3826,3989,5845,5095,6956,6628,7489,6574,7716,7282,3871,37
07,4040,3923,7443,6982,6811,7363,3803,3549,3066,3948,5934,5373,6632,7255,3773,3039,3981,3887,6383,6522,6
603,6766,7554,6771,5743,6021,6581,6524,5594,5838,7345,7752,6962,7322,5609,5976,5813,5112,6049,5933,7438,
6605,5963,5727,7687,6640,6813,7334,5565,5843,7461,6823,4863,6000,5820,5620,7284,7223,3573,4003,4036,393
2,5085,5502,5850,5918,7365,6868,6985,7449,6773,7728,6495,6611,3774,3996,3828,3566,7504,6582,7259,6881,63
95,6606,6586,6585,5931,5595,7810,6613,7693,6391,6827,7340,3068,3815,3953,3899,6040,5959,5986,5563,3941,3
993,3805,3578,5099,5618,7370,6986,7556,7271,6882,7288,4006,3519,3055,4048,5859,5791,7452,7043,7746,6814,
5946,5086,5101,6033,7462,6927,7229,6993,5818,5941,7699,7337,5591,5751,3895,3946,3571,3990,6964,7720,687
2,7072,6935,6511,5861,6052,7520,7045,5583,5846,7377,6774,5965,5617,7465,6829,6988,7348,6777,6855,5055,59
92,4009,3919,3819,3577,5359,6036,7262,6397,6835,7445,6968,7319,5866,5973,7046,6830,7812,7366,5605,5807,7
560,7277,6884,7491,3960,3806,4037,3994,3574,3954,3931,3821,5852,5942,6994,6519,7702,6588,5107,6056,7450,
6614,7311,6627,7691,6559,5880,5966,4005,3901,4024,3063,5758,5109,6629,7049,6081,5849,7346,6939,6617,738
4,6778,6888,6023,5624,7760,6996,5945,5978,7104,7466,7009,6837,5862,5607,3799,4041,3551,4010,7275,7938,74
94,6941,7369,7748,7715,7050,6050,5815,7396,6859,7285,7474,5873,4991,3829,3933,3956,4064,6951,6618,6780,7
323,2015,2045,3902,3580,6838,6398,5535,5102,7694,7809,5974,5987,6861,7215,7459,6719,7057,7584,6942,6955,
6523,7352,6035,5757,7497,7335,5598,6082,6841,7708,5948,6030,6575,7286,6751,7372,4020,3822,3067,3943,663
3,7468,5819,5868,7010,6867,5611,5993,4035,4017,3830,3327,6630,7717,7325,7378,7052,7937,7705,6862,5110,55
66,6957,7508,5839,6027,6620,7000,3991,3947,4042,3711,7261,7555,6983,7473,7439,7290,6869,6842,7616,7058,5
113,6064,7393,6896,7012,6963,7493,6958,6583,7073,5977,5990,7341,7722,5865,5613,6634,7283,5874,6037,5919,
5755,7824,6767,6088,5971,7776,7480,5851,5597,6815,7342,7506,6883,4012,3833,3069,3983,5114,5996,7747,770
1,5821,5087,7557,7060,3934,4049,3455,3827,7447,6607,7380,6987,4038,4018,3927,3070,7279,6525,7816,7498,39
50,3995,3807,3955,6641,7730,7074,6965,6870,7105,7347,7326,6029,5935,7016,7562,6636,7394,7476,6775,5621,6
051,6084,5980,5822,6044,7718,7367,6873,7289,7749,6844,5876,5614,7940,6587,5116,5863,6001,5947,7451,6885,
5989,6041,7522,7706,7500,7349,6989,7463,7064,6526,3575,4044,3834,4007,7729,6966,7569,6995,7373,6874,775
3,6642,4050,3961,3997,4065,5853,5626,7024,7400,6886,6589,7536,6615,3582,3836,3958,4013,6054,5567,5103,60
96,6779,7292,7840,7076,7724,6831,5943,5994,7354,7564,7756,7469,5619,6038,7944,7047,7278,6969,6057,5967,7
379,7505,5867,5625,6644,7721,6990,7814,7339,6889,6008,5854,4052,3949,4014,3823,6970,6876,6085,6042,7408,
6590,7106,7570,7764,7080,7521,6619,5622,6002,699

7,7454,7011,6781,7695,7374,5979,5869,7558,7051,4056,3579,4019,3998,7350,7811,7732,7477,6631,7952,6053,5949,6839,7585,7231,6890,3957,4039,4066,3775,6072,5111,6972,6897,7754,6998,7381,7470,5847,6089,5599,6058,7001,7512,7353,6648,6943,7499,6399,7108,5877,5981,7386,7053,6004,6112,7817,7703,7453,6863,7287,6621,7761,7059,7592,7524,3964,3903,4022,4043,6782,6892,5950,5628,7088,7872,7475,7371,7013,7736,7572,6635,6843,7397,6068,5870,4068,4025,3835,3962,4053,3935,3071,4011,7495,6898,5115,5991,7327,7709,7002,7762,7561,7620,6622,7112,7404,6527,6083,6065,7356,7054,7945,6959,7723,7120,5878,5375,7014,7828,7777,7061,6039,5995,7481,7385,6090,5759,7750,7968,6871,7294,7586,6637,7501,7395,6060,5881,4046,3831,4072,4028,7820,7017,5117,6031,7528,6845,7710,7075,7467,7942,7509,7617,6900,7478,7004,6643,6875,7792,7382,6967,7719,7066,7343,7818,5982,6097,7018,7576,7565,7062,5503,5875,6086,6066,7780,7398,3951,4021,4051,3837,6646,7939,5975,5118,7077,7510,5998,6043,7482,7826,7731,7355,7632,6887,7502,6904,4045,4080,4026,3965,7388,7725,7025,7291,6638,7523,7416,6846,7065,7768,6645,7020,5855,6003,7559,6991,8000,7588,7136,7841,5623,6092,5882,6055,6591,7751,7580,7513,6098,6009,7401,7848,6045,6113,6877,7941,5630,5884,7813,7484,7375,6971,7734,7078,4058,3567,4067,4054,7778,7618,7026,7081,3999,3959,4069,4057,7107,7563,6891,7409,7263,6649,7525,6999,7068,7954,6006,6061,6878,6973,7707,7357,7755,7507,6100,5997,7574,7402,7832,7530,7109,7758,7874,7383,6062,5871,7082,7028,6104,5627,6650,7471,7733,7948,6067,6046,6893,7514,7784,7089,7110,7600,7825,6899,3838,4074,4023,4060,7410,7003,6005,6087,7571,7737,7532,7084,7358,6974,7953,7055,4015,3963,4073,4070,7765,7726,7976,7015,6114,5823,6783,7624,7842,7479,7032,7516,7389,6623,7566,7412,6012,5951,6070,6091,7090,7876,7821,6894,7946,7770,7537,7113,6116,6073,6652,7757,7005,7590,8001,7483,6901,7526,7114,7844,7387,7063,5883,6010,7738,7577,7970,7648,7019,7779,7403,7006,4029,3966,4081,4047,6101,5983,8064,7819,5119,6059,7589,6902,4076,3581,4059,4030,7293,7092,7503,7960,7740,7815,7856,7121,7529,7067,7766,7116,7578,7455,6094,5879,7873,6905,7540,7021,6120,6076,7351,7619,7593,7956,7096,7830,6639,7406,5999,6069,7788,7763,7485,7573,7969,6847,7515,7782,4082,4027,4071,4061,7711,7880,7079,7829,7122,7769,7027,6906,7390,6647,7602,7069,7538,7413,6099,5885,7022,7622,6879,7943,6093,6128,7822,8004,6074,6013,7587,7781,6106,5615,7625,7517,7843,7399,7137,7735,4084,4055,4078,4062,7972,7596,7029,7083,7138,7544,7888,7800,7124,7833,7070,6908,7414,7085,7772,7511,7949,7601,6115,6102,8065,7727,7531,7786,6047,6007,7111,7411,7628,7594,6117,6105,7030,6975,7827,7486,7955,7091,7849,7575,6651,7405,7984,7033,7794,7128,7904,7634,7759,6895,5886,6122,7846,7086,8002,7567,7604,7527,7140,7836,7785,7958,7115,7621,6071,6108,7417,7656,7877,7034,7742,7518,6063,6011,6653,7950,8066,7793,7093,7117,4088,3583,4075,4077,7541,7633,7852,7771,7144,7834,7036,7418,7582,7961,7534,7608,6121,6118,8012,7094,7295,7875,7650,7971,7741,7007,6077,6014,6129,6095,7595,6903,8008,7858,7845,7539,7947,7152,7767,7626,7420,6654,7579,7796,7123,7636,7097,8072,7973,7533,7882,6907,4083,4085,3839,4086,6124,5629,8016,7118,7597,7787,7857,7962,7359,7546,7773,7664,7974,7835,7098,7603,7878,7023,7125,7649,6107,6078,7850,7126,8068,7071,7977,7783,7591,7890,6130,6075,7487,7823,7964,7905,7623,7419,7139,7884,7545,8032,6909,7100,4089,3967,4090,4087,7640,8005,7031,7581,7129,7864,7141,7774,7957,7606,6119,6109,7542,7789,6132,6103,7992,7831,7391,7860,8080,7130,7627,7795,7889,7087,8003,7652,7978,7598,7035,7985,4092,4091,4079,4031,7142,7739,7422,6910,7609,7853,7908,7790,6126,6110,7881,6655,7629,7548,7837,8010,6136,5631,8096,7635,7132,7801,7896,7951,7543,7988,7145,7095,7798,8070,7851,7535,7146,7612,7980,7638,8017,7415,7838,7037,8067,7605,7892,7859,6123,6125,7119,8006,7038,7959,6131,6133,7641,7797,7654,7906,7986,7519,7847,7153,7610,8018,7099,7883,7630,8074,8033,7148,7802,7965,7862,8073,5887,6134,7743,7651,7920,7549,7879,7975,7637,7154,8128,7599,7101,8009,7127,7854,7102,7658,8020,7912,6137,6015,7865,8082,7804,7644,7547,8036,7963,7885,7 660,7131,8076,7607,7156,7987,7893,7143,7982,7421,7791,8069,7642,7886,7657,8024,7861,7160,8097,7981,8011,7775,7613,7891,6911,8048,7868,7668,7133,7550,7898,7966,6138,6135,7979,7643,8088,8007,8034,7611,7147,7666,7907,7839,7994,7134,7149,8081,7866,7989,4094,4095,4063,4093,7639,7799,7909,8100,7631,7894,8013,7665,6140,6139,7103,8040,7407,8084,7914,8021,7653,7855,7900,7990,7155,8104,7928,8014,7806,7157,8129,7897,8071,7672,7993,8026,6127,6079,7910,7655,8098,7863,7921,7039,7583,7150,8022,8035,8083,7805,7646,8130,7996,8078,6142,6143,7867,7916,7659,8041,7158,7614,7887,8075,7161,8112,8025,8038,7913,7661,7922,8085,7967,7803,8136,8019,7899,7645,7162,8044,7869,7135,8077,7983,7669,8099,8132,8028,7870,8092,7924,7662,7164,7911,8049,7995,8037,8089,7901,7674,8102,7615,7151,8144,7991,8042,7667,8086,8105,8015,7915,7673,8056,7902,8133,8090,7670,8050,8027,7917,8101,7997,8120,7159,7895,8137,7647,8106,7925,8029,8052,8160,6111,6141,7998,7676,8116,7918,7163,8039,8131,8113,7926,7423,8087,8043,8138,7807,8108,7929,7165,8079,8030,8145,7551,7923,8134,8114,8023,7166,8046,8091,7903,8051,7671,8140,7930,8103,8146,8057,8093,8161,7678,7932,8054,8109,8148,8045,8110,7919,8152,7675,8115,8094,8053,8135,8162,7871,8060,7999,8118,8139,8164,8121,7931,8058,8149,8031,7167,8107,8142,7927,8168,8124,8047,8117,8147,7933,8141,8176,8122,8061,8154,7663,8163,8150,8095,8055,8165,8153,7934,8170,8119,8156,8111,8059,8169,8166,8125,8062,8177,8143,8172,7677,8155,8126,8178,8123,8167,8157,8180,8151,8174,8158,8184,7679,8171,8173,8179,8181,7935,8182,8185,8063,8186,8183,8188,8187,8175,8127,8190,81 91,8159,8189]

**Sequence group 6: Z6_8192**

[0,1,2,7,3,8,11,24,4,10,13,28,16,33,35,77,5,12,14,32,19,38,47,81,22,46,42,88,57,96,102,168,6,17,21,40,23,45,51,90,29,55,59,97,72,110,116,186,34,61,75,114,80,123,135,197,87,137,148,225,153,238,264,385,9,18,26,54,30,58,71,105,36,76,62,117,84,127,142,206,44,74,86,136,92,145,152,233,100,155,170,252,184,272,291,432,53,89,98,151,111,162,178,269,121,179,196,283,210,305,321,473,139,204,230,311,236,324,349,510,257,357,379,535,400,564,607,863,15,25,31,73,39,79,82,141,48,85,93,150,101,160,165,266,56,94,103,163,115,177,193,286,126,194,205,300,232,318,344,493,64,108,122,183,128,195,213,313,149,228,237,326,256,355,373,534,164,246,270,361,284,393,402,559,307,420,458,594,483,628,706,869,69,124,144,216,159,235,255,359,169,258,275,384,292,401,431,583,191,287,301,413,325,446,477,642,338,486,515,674,543,716,750,1007,212,314,332,462,362,492,519,695,397,531,560,740,596,754,830,1096,429,574,608,793,623,849,885,1161,701,905,943,1152,979,1229,1319,1690,20,37,41,91,49,95,106,176,50,107,118,187,132,207,217,340,63,119,133,222,146,231,244,341,154,243,265,378,288,396,408,558,67,143 ,156,224,173,247,271,394,181,279,293,410,304,443,466,620,180,302,316,442,337,480,495,675,366,521,544,715,572,748,798,1069,78,167,174,277,190,298,315,433,198,320,330,475,350,508,525,713,259,345,363,513,386,541,569,742,423,578,614,786,645,846,892,1142,297,381,411,551,439,593,618,832,471,634,658,862,707,920,954,1203,516,703,717,944,743,981,926,1249,813,1057,1097,1338,1109,1459,1527,1769,83,188,192,336,248,354,372,520,278,377,387,548,422,580,613,834,294,414,438,581,460,619,649,872,487,663,694,910,741,951,1003,1265,339,444,465,648,494,685,725,930,546,728,752,999,814,971,1079,1356,591,778,840,1061,873,1108,1147,1414,921,1155,1154,1507,1251,1551,1611,1944,380,484,522,729,579,753,797,1019,615,833,851,1098,902,1117,1153,1453,652,881,936,1143 ,958,1159,1257,1553,1015,1278,1315,1621,1382,1713,1766,2133,714,948,993,1259,1077,1268,1370,1648,1094,1362,1424,1733,1486,1805,1910,2294,1119,1472,1541,1837,1590,1924,1874,2335,1685,2001,2048,2498,2168,2568,2703,3011,27,43,52,99,60,120,134,214,66,138,147,221,158,241,245,390,68,157,166,240,175,299,308,428,200,310,335,472,352,497,523,738,70,172,189,303,202,333,346,490,215,358,374,532,392,565,588,756,229,382,405,576,434,612,629,820,448,621,665,880,672,908,949,1333,109,201,211,351,223,375,391,550,253,409,424,600,451,640,662,838,276,427,464,626,489,670,681,894,512,683,692,953,776,982,1051,1358,295,488,506,690,540,719,737,963,568,775,803,1014,854,1070,1099,1429,599,829,876,1105,92

2,1138,1213,1489,989,1220,1282,1568,1316,1631,1722,2122,
112,219,242,403,274,425,459,644,290,467,491,684,517,697,709,960,319,507,537,711,567,766,795,1010,597,818,8
52,1090,895,1120,1187,1434,347,549,587,799,630,841,839,1123,653,884,906,1162,965,1217,1237,1573,696,923,9
85,1230,1011,1297,1318,1656,1056,1350,1403,1734,1503,1815,1917,2307,368,606,635,886,680,919,967,1221,763,
988,1034,1311,1038,1328,1377,1709,779,1036,1055,1367,1135,1402,1478,1802,1200,1500,1539,1840,1605,1954,2
018,2362,819,1149,1176,1437,1242,1511,1550,1895,1283,1595,1659,1988,1723,2056,2147,2521,1409,1665,1741,2
073,1834,2186,2227,2665,1897,2273,2333,2743,2429,2868,2981,3454,129,254,282,470,317,505,533,747,328,542,5
75,773,601,810,871,1189,360,589,643,835,667,917,897,1202,686,937,978,1277,1030,1303,1336,1686,435,656,687,
911,762,962,994,1314,772,1033,1049,1337,1076,1378,1413,1779,780,1066,1112,1411,1198,1475,1531,1843,1232,
1583,1604,1961,1664,2019,2101,2477,450,761,765,1012,785,1037,1089,1392,828,1136,1173,1455,1218,1518,1592 ,1929,984,1191,1248,1533,1287,1628,1667,2003,1383,1680,1752,2079,1836,2178,2207,2655,1048,1296,1366,1630 ,1410,1730,1786,2119,1484,1811,1858,2204,1925,2275,2360,2793,1548,1902,1980,2332,2043,2404,2476,2882,213
0,2501,2557,2970,2622,3099,3124,3759,463,787,809,1185,961,1207,1236,1581,1001,1269,1307,1639,1374,1701,1
777,2109,1053,1334,1405,1717,1451,1789,1861,2197,1526,1922,1849,2259,2006,2343,2428,2819,1201,1415,1474,
1823,1571,1878,1963,2322,1617,1981,2042,2405,2097,2433,2533,2947,1726,2067,2142,2485,2235,2588,2645,305
9,2290,2732,2778,3190,2869,3268,3298,3622,1292,1479,1614,1986,1691,2036,2070,2460,1767,2163,2190,2550,22
61,2589,2747,3118,1783,2243,2324,2724,2426,2798,2803,3294,2509,2896,2943,3339,3038,3476,3551,3949,1932,2
398,2406,2850,2546,2900,2972,3369,2618,3058,3080,3520,3209,3556,3775,4114,2689,3175,3243,3662,3352,3689,
3860,4249,3427,3894,3944,4370,4048,4478,4543,4944,140,113,65,289,104,267,182,518,125,185,203,456,220,356,
327,592,161,218,239,334,268,412,376,691,306,388,430,561,474,767,632,957,171,249,273,395,309,421,481,609,32
9,509,447,868,547,657,702,1329,353,485,577,671,530,736,825,1127,602,808,764,998,893,1190,1039,1658,199,296 ,312,461,348,496,557,710,383,625,511,751,590,781,848,1054,415,545,669,821,633,952,802,1095,582,853,980,114
8,916,1386,1228,2000,449,666,603,903,755,870,1008,1175,700,1067,942,1300,995,1241,1582,1458,792,1018,1081 ,1425,1126,1312,1357,1712,1177,1501,1395,1903,1569,2234,1803,2646,234,331,369,536,404,573,624,831,445,712 ,595,860,659,900,964,1258,476,631,757,909,693,1050,945,1233,784,1000,1113,1317,1071,1372,1481,1748,514,74
6,673,970,850,1031,1121,1347,824,1197,1052,1594,1163,1422,1435,1850,904,1110,1276,1480,1219,1517,1640,22
84,1339,1684,1576,1893,1776,2021,2100,2768,566,774,877,1091,812,1134,1239,1499,927,1304,1172,1729,1359,1
538,1635,1960,983,1212,1373,1588,1454,1668,1842,2039,1279,1797,1700,2196,1900,2132,2334,2936,1035,1408,1
487,1807,1310,1735,1871,2397,1549,1950,2033,2206,1768,2499,2295,3628,1610,1989,2078,2461,2135,2353,2432,
3095,1916,2554,2623,2849,2702,3389,2980,4423,285,389,426,627,482,718,664,956,504,682,842,1006,760,1064,11
16,1394,556,794,739,1088,847,1231,1042,1452,918,1137,1256,1510,1184,1708,1629,2265,598,861,811,1332,992,1
122,1188,1519,901,1216,1293,1828,1363,1579,1669,2049,1013,1393,1313,1728,1488,1643,1835,2129,1433,1796,1
886,2183,1959,2302,2479,2832,641,1078,887,1243,950,1412,1302,1740,1043,1346,1461,1687,1516,1806,1896,223
6,1146,1589,1436,2029,1379,1830,1879,2435,1681,1947,2057,2312,2131,2391,2559,3163,1206,1620,1514,1911,17
19,2002,2187,2539,1814,2258,2035,2456,2096,2735,2640,3067,1552,2162,2352,2675,2274,2594,2918,3052,2407,2
862,2769,3332,3019,3227,3477,4522,724,966,1104,1387,1174,1450,1638,1928,1240,1754,1485,1987,1577,1860,21
34,2535,1060,1532,1615,2094,1732,2303,2032,2493,1859,2201,2264,2710,1946,2883,2630,3774,1335,1657,1804,2
382,1931,2226,2179,2828,1718,2288,2469,2664,2401,2758,2961,3261,2071,2437,2342,2779,2538,3107,2903,3347,
2641,2982,3182,3519,3081,3450,3861,4113,1404,1831,1971,2285,1755,2551,2361,2848,2123,2390,2695,2944,246
8,3018,3204,3602,1894,2595,2511,3037,2725,3242,3093,3574,2874,3130,3406,3505,3323,3935,3806,4274,2203,27
99,2652,3223,2951,3642,3156,3739,2555,3424,3299,3830,3338,3913,4045,5157,2773,3611,3521,4148,346

1,4016,4
212,4624,3717,4163,4097,4761,4347,5509,4656,5805,367,457,524,749,586,777,843,1118,622,955,815,1264,896,11
60,1324,1634,668,855,1009,1196,931,1441,1250,1707,1065,1376,1515,2020,1351,1749,1822,2314,708,1002,959,1
306,1080,1371,1498,1848,1199,1591,1423,1782,1572,1901,2111,2453,1139,1530,1473,1892,1642,2050,1962,2399,
1731,2095,2200,2973,2240,2654,2558,3222,796,1032,1186,1440,1305,1502,1800,1945,1111,1540,1666,2028,1578,
2169,2037,2520,1286,1716,1753,2299,1616,2110,2260,2694,1923,2325,2149,2615,2434,2772,2901,3441,1432,178
8,1970,2205,1870,2383,2313,2823,2066,2548,2457,2759,2298,2919,2995,3402,1841,2579,2508,2945,2711,3131,30
60,3575,2417,3039,3210,3923,3322,3799,3688,4457,907,1325,1158,1641,1238,1958,1593,2241,1460,1706,1851,22
15,1810,2146,2374,2833,1428,2072,1887,2478,1787,2323,2291,2929,2034,2427,2619,2775,2547,3026,3098,3537,1
570,1933,2128,2396,2191,2674,2532,3174,1951,2492,2802,3066,2614,2983,3295,3643,2242,2762,2669,3111,2937,
3426,3216,3753,2897,3316,3562,3826,3460,3948,4020,4829,1727,2272,2038,2647,2143,2556,2792,3236,2315,301
0,2742,3191,2851,3337,3407,3868,2416,2946,2829,3451,3110,3368,3603,4272,3044,3701,3478,3934,3652,4096,41
79,4612,2510,2839,3157,3536,2994,3594,3738,4049,3309,3912,3636,4162,3827,4221,4359,4757,3226,3758,3920,4
523,4044,4308,4422,5007,3678,4471,4626,4918,4657,5103,5302,5968,1068,1375,1301,1875,1506,1955,1829,2363,
1580,1778,2148,2688,2051,2436,2569,3045,1649,2108,2007,2484,2289,2902,2549,3125,2237,2631,2763,3336,283
8,3211,3479,3922,1801,2306,2202,2653,2400,2734,2774,3237,2118,2822,2960,3504,3092,3437,3388,4005,2500,29
71,3162,3353,3053,3563,3653,4122,2928,3724,3550,4051,3810,4235,4346,4861,1930,2182,2534,2950,2375,2875,3
119,3517,2668,3269,3027,3440,2644,3610,3679,4155,2746,3094,3183,3927,3308,3637,3782,4542,3425,3908,3725,
4220,4019,4309,4516,4941,2863,3208,3518,3783,3333,4058,3909,4371,3623,3831,4123,4449,3945,4727,4566,505
0,3455,4050,4213,4613,4316,4798,4718,5225,4178,4645,4919,5345,4860,5149,5439,6037,2214,2452,2578,3106,28
18,3403,3061,3716,2733,3217,3205,3869,3346,4004,3811,4479,2942,3557,3317,3798,3629,3921,4149,4448,3516,4
059,4195,4567,4021,4648,4771,5224,3036,3436,3752,4017,3595,4234,4112,4627,3663,4154,4275,4945,4470,4719,
4756,5344,3895,4403,4533,4770,4358,5051,4862,5332,4248,4889,5148,5587,5021,5438,5565,6373,3260,3700,380
7,4402,4018,4194,4532,4799,3926,4273,4456,4863,4625,5120,5006,5441,4115,4517,4644,5102,4726,4940,5207,56
79,4760,5235,5156,5564,5333,5663,5769,6800,4317,4649,4828,5206,4888,5234,5409,5662,5020,5408,5303,5872,5
508,5873,5768,6372,5121,5440,5586,5882,5678,5883,5969,6179,5804,6036,6178,6285,6284,6801,6446,6447,130,1
31,208,251,209,280,323,440,226,322,343,478,370,527,529,783,227,342,364,526,399,562,611,817,436,610,584,844,
661,888,924,1208,250,371,407,570,437,605,647,874,479,655,689,889,768,946,986,1280,528,699,771,976,816,1005 ,1063,1299,837,1073,1124,1421,1141,1456,1528,1909,281,398,468,654,498,688,759,929,538,782,704,987,826,102
9,1092,1348,604,770,836,1072,878,1107,1140,1439,898,1145,1210,1504,1270,1554,1613,2022,651,845,890,1133,9
47,1166,1226,1537,997,1227,1298,1597,1360,1651,1711,2117,1075,1344,1430,1689,1448,1714,1795,2198,1513,18
21,1889,2281,1948,2368,2455,2993,365,441,499,769,563,801,822,1083,616,827,879,1132,899,1164,1179,1534,660 ,882,925,1167,977,1225,1291,1606,1028,1294,1345,1632,1438,1704,1790,2177,726,940,1004,1267,1040,1295,136
5,1697,1125,1426,1449,1720,1512,1813,1873,2280,1178,1490,1542,1839,1598,1935,1952,2341,1671,1984,2076,24
24,2151,2502,2666,3005,745,1016,1106,1380,1157,1443,1509,1833,1209,1524,1561,1908,1618,1949,2017,2395,12
89,1607,1633,1979,1715,2058,2141,2526,1780,2164,2225,2600,2293,2690,2744,3239,1364,1698,1750,2086,1856,2
176,2239,2635,1943,2277,2354,2720,2430,2760,2922,3396,2011,2378,2458,2827,2491,2953,3029,3509,2657,3063,
3127,3500,3193,3631,3773,4302,406,539,571,875,617,883,938,1224,646,939,990,1281,1058,1349,1381,1784,705,9
91,1059,1406,1114,1431,1482,1785,1144,1477,1529,1888,1608,1942,1968,2340,731,1093,1150,1420,1215,1491,15
43,1940,1235,1575,1619,1976,1650,2053,2098,2488,1234,1636,1702,2052,1771,2144,2181,2601,1862,2257,2296,2 687,2376,2740,2836,3351,800,1205,1222,1563,1288,1626,1699,2023,1308,1710,1742,2121,1798,2194,2267,2685,1525,1791,1857,2213,1918,2287,2373,2722,1991,2388,2470,2824,2537,2948,3046,3490,1625,1891,1977,2321,2041,2419,2486,2924,2103,2522,2566,2992,2667,3086,3154,3593,2232,2659,2691,3128,2723,3195,3104,3655,2881,3321,3397,3796,3405,3981,4067,4401,823,1284,1290,1770,1496,1812,1872,2256,1574,1885,1919,2304,1990,2392,2463,2926,1622,1982,2040,2393,2084,2487,2545,3008,2165,2571,2634,3074,2721,3147,3231,3677,1781,2054,2093,2544,2180,2617,2701,3108,2300,2708,2756,3225,2898,3189,3373,3816,2411,2814,2938,3335,3009,3404,3497,3902,3087,3503,3502,4047,3661,4105,4197,4636,1890,2160,2262,2709,2389,2757,2835,3271,2471,2925,2955,3398,3056,3439,3501,3965,2552,3025,3116,3491,3160,3507,3665,4107,3263,3708,3765,4207,3870,4327,4390,4849,2686,3144,3219,3667,3371,3690,3848,4232,3390,3824,3914,4355,4008,4463,4604,5048,3443,3988,4091,4499,4164,4610,4540,5089,4287,4705,4762,5284,4890,5346,5477,5771,469,585,650,891,698,996,1062,1368,730,1074,1115,1401,1156,1463,1483,1926,744,1151,1204,1462,1223,1627,1682,2010,1326,1688,1765,2116,1808,2185,2263,2718,758,12141285,1637,1330,1751,1792,2170,1369,1832,1876,2278,1934,2369,2408,2770,1427,1898,1957,2380,2030,2462,2503,2910,2064,2489,2577,3024,2592,3072,3145,3787,941,1327,1361,1799,1407,1877,1927,2320,1505,1969,2004,2444,2069,2524,2570,2930,1562,2009,2092,2496,2167,2590,2603,3048,2212,2613,2632,3153,2812,3196,3307,3818,1623,2166,2192,2628,2286,2693,2717,3167,2372,2811,2861,3262,2968,3354,3399,3925,2439,2921,3016,3401,3096,3488,3609,4011,3207,3620,3710,4116,3766,4217,4344,4830,968,1385,1476,1953,1560,2005,2077,2536,1612,2099,2171,2616,2233,2643,2671,3164,1705,2193,2283,2673,2371,2800,2831,3252,2431,2908,2962,3382,3049,3448,3549,3936,1793,2305,2403,2837,2516,2939,2931,3453,2553,3028,3064,3510,3173,3613,3639,4121,2642,3097,3199,3632,3253,3737,3772,4236,3320,3808,3887,4356,4035,4485,4607,5057,1868,2454,2523,3030,2602,3085,3181,3621,2795,3206,3288,3755,3292,3784,3859,4325,2815,3290,3319,3829,3481,3886,4000,4460,3590,4032,4089,4504,4193,4650,4720,5114,2909,3499,3526,3939,3646,4057,4104,4585,3711,4177,4239,4698,4345,4772,4867,5301,3897,4251,4369,4783,4496,4908,4947,5443,4587,5013,5079,5495,5195,5618,5743,6146,1041,1508,1596,2102,1703,2189,2279,2727,1724,2292,2379,2809,2445,2872,3007,3559,1838,2409,2527,2927,2585,3083,3051,3592,2620,3117,3192,3703,3276,3747,3794,4300,2031,2564,2621,3075,2794,3166,3220,3764,2808,3279,3305,3795,3370,3862,3901,4415,2816,3348,3414,3899,3588,3991,4081,4507,3634,4153,4192,4661,4250,4721,4813,5257,2068,2777,2797,3254,2821,3291,3381,3878,2920,3482,3523,3967,3614,4064,4166,4615,3198,3561,3654,4083,3719,4214,4261,4707,3871,4284,4378,4797,4498,4904,4935,5437,3304,3736,3828,4216,3898,4352,4428,4827,4006,4477,4518,4932,4611,5015,5112,5553,4098,4594,4678,5078,4759,5178,5256,5630,4834,5287,5337,5726,5402,5855,5880,6419,2087,2825,2871,3539,3165,3601,3638,4151,3229,3691,3751,4223,3856,4311,4413,4815,3311,3792,3893,4337,3951,4431,4521,4917,4066,4608,4509,4989,4716,5091,5194,5581,3591,3903,3990,4487,4119,4564,4663,5070,4205,4679,4758,5179,4807,5201,5305,5717,4348,4775,4864,5277,4957,5350,5411,5835,5042,5486,5542,5942,5619,6016,6032,6286,3726,4001,4198,4696,4303,4744,4780,5226,4391,4879,4910,5326,4991,5351,5511,5874,4421,4979,5076,5484,5192,5554,5567,6018,5297,5648,5709,6067,5824,6166,6219,6545,4622,5170,5188,5610,5314,5650,5740,6085,5400,5834,5844,6198,5947,6224,6429,6646,5461,5939,5981,6336,6078,6345,6496,6747,6111,6512,6538,6838,6624,6918,6939,7170,1082,969,727,1609,928,1535,1266,2238,1017,1271,1331,2074,1400,1820,1721,2418,1165,1384,1457,1764,1536,1978,1884,2629,1670,1920,2016,2355,2120,2801,2518,3159,1211,1497,1555,1941,1683,1985,2145,2459,1725,2195,2059,3004,2301,2565,2658,3785,1809,2161,2381,2591,2276,2716,2917,3463,2446,2870,2796,3224,3047,3560,3293,4238,1309,1624,1696,2085,1794,2184,2327,2672,1899,2495,2199,2745,2410,2817,2952,3318,1983,2297,2587,2911,2519,3152,2860,3391,2394,2963,3194,3498,3082,3876,3630,4704,2065,2584,2447,3057,2761,3006,32

40,3525,
2656,3349,3126,3744,3221,3645,4152,3980,2826,3270,3375,3915,3462,3756,3817,4326,3527,4033,3885,4595,411
7,4956,4461,5424,1442,1743,1869,2282,1956,2377,2494,2923,2055,2684,2425,2974,2567,3054,3172,3666,2140,25
17,2771,3073,2633,3306,3129,3635,2820,3228,3415,3767,3355,3850,4003,4376,2224,2726,2593,3188,2954,3277,3
449,3805,2916,3573,3310,4176,3511,3910,3937,4510,3062,3412,3702,4002,3615,4063,4228,5022,3797,4286,4136,
4575,4412,4723,4812,5528,2370,2810,3017,3383,2880,3480,3641,4023,3105,3748,3522,4351,3819,4088,4219,466
0,3197,3608,3851,4160,3966,4262,4506,4747,3709,4451,4310,4916,4592,4848,5088,5686,3289,3896,4009,4469,37
54,4357,4535,5169,4099,4646,4733,4934,4400,5285,5049,6308,4196,4699,4796,5227,4851,5101,5200,5853,4606,5
334,5403,5609,5476,6087,5742,6851,1599,1921,2008,2497,2150,2692,2576,3158,2188,2612,2940,3238,2776,3344,
3438,3884,2326,2830,2719,3380,2949,3633,3296,3964,3084,3483,3664,4056,3538,4324,4215,5005,2438,2975,287
3,3786,3218,3452,3558,4065,3055,3612,3727,4492,3825,4139,4263,4763,3255,3879,3757,4350,4010,4231,4497,48
33,3933,4450,4572,4907,4659,5054,5259,5592,2525,3372,3031,3647,3146,3900,3746,4368,3297,3804,3983,4301,4
062,4468,4586,4958,3496,4161,3938,4725,3863,4494,4565,5203,4285,4639,4773,5058,4835,5159,5339,5937,3600,
4206,4060,4605,4339,4706,4909,5313,4484,4988,4735,5214,4806,5493,5406,5843,4106,4878,5100,5455,5014,538
4,5676,5832,5189,5616,5529,6054,5777,5973,6167,6930,2700,3180,3400,3877,3524,3950,4222,4614,3644,4388,40
07,4697,4137,4520,4850,5307,3334,4082,4199,4804,4354,5055,4732,5279,4519,4925,5004,5478,4638,5631,5404,6
428,3793,4237,4462,5150,4621,4946,4905,5584,4338,5040,5233,5442,5177,5512,5725,5983,4781,5205,5090,5543,
5312,5861,5661,6077,5407,5748,5940,6197,5845,6144,6497,6645,3892,4495,4677,5023,4389,5327,5113,5608,483
1,5158,5463,5710,5232,5776,5944,6276,4584,5385,5299,5807,5485,5980,5847,6252,5628,5920,6102,6193,6053,65
37,6434,6774,4927,5555,5426,5971,5719,6324,5922,6375,5335,6108,6033,6454,6066,6517,6607,7325,5531,6279,6
199,6670,6165,6588,6724,6996,6365,6699,6635,7089,6803,7469,7020,7637,1863,2075,2266,2741,2402,2813,2941,
3442,2490,3155,2899,3676,3050,3508,3780,4218,2586,2969,3241,3572,3109,3947,3660,4319,3345,3858,4061,472
2,3809,4377,4486,5068,2670,3230,3161,3750,3374,3849,4022,4508,3589,4165,3911,4420,4120,4593,4825,5213,34
89,4080,3989,4574,4230,4768,4662,5171,4353,4805,4924,5741,4976,5436,5338,5970,2834,3278,3548,3946,3749,4
034,4458,4637,3413,4090,4260,4724,4138,4891,4745,5300,3718,4336,4379,5053,4204,4824,4990,5462,4609,5077,
4877,5387,5202,5530,5651,6131,3932,4430,4676,4933,4534,5151,5059,5583,4774,5324,5215,5513,5052,5677,575
1,6100,4505,5349,5296,5711,5479,5921,5840,6253,5191,5825,5960,6529,6052,6433,6344,6871,3065,3781,3506,42
29,3640,4658,4167,4977,3982,4318,4511,4943,4476,4866,5122,5593,3924,4782,4573,5258,4429,5071,5043,5685,4
734,5193,5401,5541,5315,5778,5854,6217,4118,4623,4832,5168,4911,5454,5304,5938,4647,5278,5566,5842,5386,
5749,6019,6325,4978,5514,5453,5863,5687,6110,5962,6417,5649,6038,6226,6452,6164,6544,6604,7107,4349,501
2,4746,5425,4865,5336,5552,5974,5069,5770,5494,5943,5611,6065,6103,6498,5190,5716,5585,6145,5862,6084,62
77,6772,5826,6347,6176,6536,6326,6634,6721,6946,5298,5595,5923,6216,5750,6254,6374,6625,6035,6516,6310,6
698,6453,6727,6837,7063,5972,6418,6518,6931,6606,6792,6850,7217,6338,6917,6998,7166,7021,7259,7384,7690,
3350,3857,3745,4541,4046,4651,4493,5115,4150,4414,4876,5460,4769,5204,5347,5827,4233,4814,4717,5276,504
1,5660,5325,5881,4959,5405,5515,6064,5594,5961,6177,6528,4459,5056,4926,5427,5176,5492,5540,5975,4826,55
82,5724,6192,5846,6129,6086,6547,5286,5727,5936,6079,5833,6227,6327,6668,5684,6366,6218,6627,6444,6745,6
802,7145,4620,4906,5306,5718,5123,5629,5875,6195,5452,6017,5779,6130,5410,6278,6339,6697,5510,5852,5941,
6531,6034,6311,6430,6938,6109,6514,6367,6726,6591,6793,6928,7169,5617,5946,6196,6431,6055,6632,6515,683
9,6287,6455,6669,6869,6539,7061,6944,7256,6147,6626,6725,6947,6794,7104,7022,7333,6720,7009,7167,7401,71
44,7279,7457,7737,4942,5212,5348,5860,5580,6101,5841,6364,5487,5963,5945,6499,6076,6546,6445,6919,5708,6225,6039,6432,6309,6519,6671,6868,6194,6633,6723,6945,6605,7010,7091,7332,5806,6128,6416,6589,6255,6744,6644,6999,6337,6696,6775,7171,6916,7023,7062,7400,6513,6849,6937,7090,6836,7257,7146,7386,6746,7165,7278,7513,7219,7456,7471,7775,5982,6346,6435,6848,6590,6722,6936,7105,6530,6773,6870,7147,6997,7276,7216,7459,6647,6929,7008,7258,7060,7168,7327,7553,7088,7335,7324,7470,7387,7515,7555,7930,6795,7011,7106,7326,7164,7334,7403,7514,7218,7402,7385,7638,7468,7639,7554,7774,7277,7458,7512,7688,7552,7689,7691,7739,7636,7736,7738,7773,7772,7931,7928,7929,260,261,262,419,263,452,455,676,416,454,501,720,552,733,735,1085,417,500,502,732,555,790,859,1101,638,858,806,1168,933,1192,1246,1564,418,553,637,804,639,857,867,1170,721,915,935,1193,1044,1262,1320,1654,734,973,1047,1274,1100,1343,1399,1677,1131,1417,1468,1817,1493,1854,1964,2349,453,554,678,914,722,934,1027,1253,788,1084,974,1321,1128,1355,1446,1738,856,1046,1130,1416,1180,1465,1492,1845,1244,1495,1566,1912,1652,1992,2047,2504,913,1169,1194,1471,1263,1546,1602,1973,1341,1603,1676,2015,1746,2105,2153,2609,1419,1736,1826,2115,1852,2156,2245,2706,1937,2253,2339,2767,2412,2852,2959,3515,503,677,723,1045,791,1087,1102,1445,864,1129,1181,1470,1245,1544,1557,1966,932,1182,1247,1547,1275,1601,1673,2026,1354,1674,1737,2088,1844,2138,2228,2677,1020,1260,1342,1647,1388,1675,1757,2125,1469,1824,1853,2158,1936,2251,2329,2766,1556,1882,1974,2269,2024,2365,2414,2843,2107,2464,2574,2906,2639,3000,3186,3529,1025,1352,1464,1760,1523,1847,1915,2255,1565,1938,1995,2348,2060,2413,2483,2887,1663,2027,2089,2449,2157,2542,2625,3022,2218,2650,2715,3122,2787,3232,3282,3791,1756,2126,2208,2582,2270,2676,2731,3151,2385,2755,2844,3264,2912,3286,3446,3960,2481,2866,2964,3377,2991,3485,3553,4073,3177,3585,3671,4052,3723,4181,4315,4846,636,789,805,1171,865,1183,1254,1600,866,1255,1322,1655,1396,1739,1761,2220,975,1323,1397,1774,1466,1827,1880,2221,1494,1867,1965,2338,2044,2384,2440,2842,1023,1447,1520,1816,1585,1883,1975,2366,1645,1999,2061,2442,2104,2531,2598,2988,1644,2090,2136,2530,2217,2636,2679,3123,2310,2737,2788,3215,2864,3280,3386,3905,1086,1559,1586,1997,1662,2082,2127,2505,1678,2152,2174,2611,2246,2704,2749,3213,1939,2229,2271,2713,2350,2785,2857,3266,2467,2878,2978,3366,3033,3474,3568,4030,2081,2345,2443,2807,2515,2905,2986,3456,2607,3014,3078,3514,3187,3616,3686,4131,2728,3179,3233,3672,3267,3729,3626,4209,3417,3873,3961,4342,3973,4531,4619,4953,1103,1660,1672,2216,1904,2250,2328,2736,1998,2337,2351,2804,2466,2884,2977,3458,2062,2450,2514,2885,2580,2987,3041,3532,2651,3091,3150,3598,3265,3683,3779,4241,2219,2540,2597,3040,2678,3137,3245,3650,2790,3248,3284,3771,3418,3715,3931,4372,2895,3358,3468,3881,3533,3972,4039,4446,3617,4055,4054,4583,4211,4667,4739,5160,2344,2648,2738,3249,2879,3285,3385,3823,2979,3457,3487,3962,3582,3985,4053,4525,3068,3545,3656,4031,3694,4071,4225,4669,3815,4254,4307,4753,4410,4881,4950,5381,3214,3680,3761,4227,3929,4244,4394,4800,3958,4382,4464,4913,4558,4997,5126,5562,3987,4544,4653,5033,4702,5136,5082,5607,4841,5237,5280,5766,5420,5836,5967,6235,679,807,912,1195,972,1340,1398,1758,1022,1418,1467,1773,1522,1865 ,1881,2358,1024,1521,1558,1864,1587,2083,2112,2480,1692,2114,2211,2608,2248,2681,2739,3258,1026,1584,1661,2091,1694,2209,2230,2662,1759,2254,2330,2764,2364,2853,2892,3300,1825,2346,2421,2876,2506,2976,3001,3428,2560,2989,3101,3544,3120,3596,3681,4333,1261,1693,1747,2247,1775,2331,2359,2806,1913,2441,2472,2932,2563,3020,3090,3466,1996,2475,2596,2998,2661,3114,3133,3570,2712,3135,3148,3685,3356,3730,3855,4374,2063,2660,2698,3142,2784,3235,3257,3699,2856,3343,3395,3814,3494,3906,3963,4473,2915,3445,3540,3969,3618,4026,4145,4561,3741,4168,4258,4680,4312,4779,4894,5374,1272,1763,1866,2415,1994,2473,2575,3032,2046,2599,2663,3136,2729,3169,3201,3696,2139,2699,2781,3203,2855,3326,3379,3802,2913,3422,3492,3954,3571,3992,4103,4482.2231.2805.2891.3387.3002.3469.3467.3995.3069.3552.3586.4074.3705.4157.4189.4685.3168.3619.3733.4182,3803,4281,4314,4808,3872,4366,4435,4914,4579,501

1,5129,5579,2316,2958,3015,3554,3132,3607,3707,4
169,331
5,3740,3838,4299,3842,4328,4405,4873,3359,3840,3
867,4387,4015,4434,4550,4994,4128,4576,4643,5036
,4729,51
74,5250,5626,3423,4041,4092,4489,4202,4591,4666,
5107,4259,4711,4811,5228,4895,5292,5395,5789,444
1,4817,4
921,5321,5030,5446,5491,5925,5109,5533,5605,6003
,5697,6116,6213,6582,1389,1914,2014,2606,2137,26
97,2765,
3275,2172,2786,2867,3341,2933,3410,3531,4109,226
8,2893,3023,3459,3103,3605,3577,4130,3138,3657,3
722,425
3,3834,4291,4340,4842,2507,3076,3139,3599,3314,3
698,3762,4306,3340,3837,3853,4341,3928,4406,4445
,4963,33
60,3890,3976,4443,4126,4547,4631,5039,4184,4695,
4728,5185,4816,5251,5361,5745,2562,3313,3325,381
2,3365,3
841,3953,4424,3444,4024,4085,4527,4158,4602,4708
,5141,3732,4111,4208,4633,4267,4776,4819,5239,44
11,4836,
4936,5331,5032,5430,5475,5915,3852,4280,4386,477
8,4442,4902,4970,5371,4556,5003,5062,5472,5137,5
535,562
4,6041,4664,5118,5216,5604,5275,5672,5744,6126,5
378,5773,5821,6206,5894,6307,6328,6791,2583,3367
,3409,41
01,3697,4135,4188,4693,3777,4245,4295,4791,4398,
4857,4961,5365,3865,4334,4437,4885,4515,4973,506
5,5465,4
618,5134,5045,5519,5242,5615,5696,6071,4129,4447
,4546,5019,4683,5086,5187,5598,4749,5217,5274,56
73,5357,
5701,5797,6183,4898,5311,5390,5753,5499,5864,590
9,6271,5558,5996,6030,6382,6117,6448,6470,6694,4
276,455
1,4742,5222,4847,5268,5318,5732,4951,5415,5450,5
814,5521,5865,6007,6322,4967,5507,5600,5992,5694
,6046,60
51,6466,5781,6132,6175,6495,6250,6592,6655,6925,
5144,5666,5674,6106,5810,6136,6208,6521,5890,627
0,6292,6
636,6397,6656,6807,7026,5953,6371,6427,6734,6508
,6749,6860,7109,6567,6882,6920,7174,6980,7222,72
63,7464,
1444,1273,1021,2045,1252,1967,1646,2730,1353,165
3,1695,2572,1772,2252,2159,2904,1545,1762,1855,2
210,197
2,2448,2336,3143,2106,2356,2482,2845,2610,3327,3
012,3693,1567,1905,1993,2367,2113,2465,2637,2965
,2173,27
05,2543,3528,2791,3077,3178,4329,2249,2649,2877,
3115,2754,3256,3433,3999,2934,3408,3324,3770,356
9,4110,3
843,4810,1679,2080,2124,2581,2244,2680,2841,3202
,2347,2997,2707,3283,2894,3361,3484,3866,2451,27
89,3113,
3429,3013,3684,3394,3959,2886,3493,3728,4040,360
4,4418,4180,5236,2561,3102,2935,3583,3287,3530,3
800,408
7,3176,3891,3670,4288,3763,4201,4694,4530,3376,3
822,3941,4465,3998,4304,4373,4880,4093,4577,4427
,5119,46
81,5498,4995,5910,1846,2175,2317,2780,2420,2865,
2996,3447,2541,3212,2907,3512,3079,3580,3704,422
6,2624,3
003,3301,3597,3149,3854,3673,4185,3364,3776,3977
,4313,3907,4396,4553,4928,2714,3274,3121,3714,34
86,3835,
3993,4363,3432,4125,3864,4710,4075,4454,4483,504
6,3584,3974,4252,4552,4159,4601,4792,5548,4343,4
840,468
8,5105,4960,5253,5360,6020,2854,3342,3541,3955,3
416,4014,4191,4571,3627,4292,4084,4901,4375,4642
,4787,51
84,3731,4144,4397,4700,4526,4820,5038,5271,4255,
4985,4856,5464,5116,5380,5606,6168,3839,4440,455
9,4999,4
298,4915,5075,5665,4665,5166,5265,5474,4952,5767
,5563,6700,4738,5229,5330,5733,5383,5621,5700,63
03,5128,
5818,5895,6105,5966,6541,6212,7195,2025,2357,247
4,2999,2638,3234,3100,3692,2696,3134,3470,3790,3
312,388
8,3984,4426,2840,3378,3259,3952,3475,4183,3846,4
524,3606,4025,4224,4590,4100,4872,4777,5525,2914
,3513,34
11,4332,3760,3994,4108,4603,3581,4156,4277,5024,
4383,4691,4821,5281,3813,4425,4305,4900,4560,479
5,5031,5
377,4481,4984,5094,5435,5183,5574,5747,6092,3021
,3930,3555,4203,3682,4444,4290,4920,3847,4362,45
37,4843,
4600,4998,5108,5500,4038,4701,4488,5261,4407,502
6,5087,5703,4837,5163,5293,5588,5379,5655,5823,6
359,413
4,4752,4598,5127,4887,5238,5447,5803,5010,5518,5
267,5728,5356,5999,5904,6283,4668,5414,5620,5935
,5534,58
70,6150,6264,5675,6114,6021,6488,6239,6411,6593,
7250,3244,3706,3968,4419,4086,4514,4790,5140,420
0,4938,4
557,5223,4689,5064,5382,5799,3880,4632,4743,5354
,4912,5575,5264,5761,5063,5469,5524,5978,5162,61
27,5898,
6806,4335,4809,4996,5646,5143,5490,5431,6088,488
6,5556,5737,5924,5669,6010,6201,6441,5319,5705,5
614,603
1,5802,6315,6139,6503,5905,6214,6378,6631,6293,6
578,6861,7025,4436,5027,5199,5549,4939,5815,5625
,6104,53
75,5654,5959,6180,5736,6238,6392,6682,5106,5871,
5783,6249,5993,6426,6301,6666,6122,6334,6558,661
7,6487,6

911,6826,7118,5471,6047,5912,6407,6187,6714,6352,6771,5819,6564,6471,6846,6494,6897,6977,7545,6025,6687,
6637,7040,6585,6964,7076,7300,6761,7051,7013,7369,7151,7693,7316,7793,2311,2573,2748,3281,2890,3357,347
1,3986,2990,3687,3419,4240,3576,4072,4320,4786,3112,3495,3801,4124,3651,4501,4210,4871,3889,4404,4599,52
52,4367,4929,5018,5590,3200,3778,3695,4294,3940,4395,4570,5044,4127,4703,4455,4966,4684,5117,5367,5721,4
027,4630,4545,5104,4794,5282,5186,5667,4903,5355,5468,6209,5504,5914,5822,6406,3384,3836,4102,4500,4293,
4578,4992,5161,3975,4652,4818,5260,4690,5421,5269,5788,4266,4884,4937,5571,4748,5366,5520,5958,5135,560
1,5397,5887,5702,6024,6137,6573,4480,4972,5198,5473,5074,5647,5589,6075,5310,5812,5729,6011,5570,6151,62
23,6554,5037,5851,5780,6181,5979,6335,6272,6667,5689,6251,6398,6903,6486,6823,6748,7205,3587,4321,4070,4
793,4190,5182,4709,5505,4536,4870,5047,5483,5002,5394,5638,6093,4472,5320,5095,5746,4971,5599,5559,6161,
5266,5695,5891,6027,5811,6242,6306,6649,4682,5145,5376,5664,5451,5934,5796,6370,5167,5760,6050,6282,588
6,6215,6467,6715,5506,6014,5929,6319,6169,6566,6400,6785,6133,6480,6662,6842,6584,6924,6968,7409,4899,55
32,5270,5911,5391,5820,6040,6420,5591,6234,6002,6383,6107,6493,6559,6864,5688,6182,6089,6579,6318,6520,6
683,7116,6256,6753,6594,6910,6728,7012,7059,7292,5782,6099,6353,6648,6222,6678,6770,6981,6477,6896,6708,
7050,6843,7085,7163,7365,6410,6790,6900,7251,6976,7128,7194,7487,6742,7215,7302,7446,7317,7531,7606,784
8,3904,4399,4289,5083,4582,5175,5025,5627,4692,4962,5396,5952,5283,5704,5837,6257,4801,5364,5243,5752,55
57,6138,5813,6329,5501,5899,6015,6492,6098,6399,6595,6902,4993,5578,5470,5913,5668,5998,6026,6421,5370,6
074,6200,6616,6300,6569,6540,6957,5772,6207,6358,6509,6265,6663,6729,7034,6160,6764,6654,6983,6830,7099,
7150,7421,5142,5434,5798,6186,5639,6123,6323,6629,5928,6449,6243,6572,5908,6686,6743,7047,6006,6302,637
9,6907,6476,6709,6810,7262,6565,6892,6765,7084,6967,7129,7244,7461,6115,6396,6630,6811,6489,6986,6893,71
75,6695,6847,7035,7201,6921,7355,7266,7502,6583,
6982,7077,7293,7132,7390,7346,7581,7058,7309,7447,7629,7
420,7541,7663,7869,5482,5720,5850,6314,6070,6555,6273,6760,5997,6401,6393,6865,6502,6956,6831,7223,6174,
6657,6481,6822,6701,6901,7041,7200,6628,6987,7067,7267,6969,7312,7375,7580,6248,6568,6784,6965,6679,709
8,7024,7303,6735,7046,7119,7465,7214,7347,7364,7628,6883,7187,7253,7374,7162,7503,7422,7620,7108,7433,75
40,7723,7493,7662,7713,7965,6440,6752,6827,7186,6966,7066,7252,7391,6906,7117,7204,7423,7301,7536,7486,7
665,7027,7245,7308,7530,7354,7460,7575,7755,7368,7587,7544,7712,7621,7751,7785,8060,7133,7313,7408,7574,
7432,7586,7653,7750,7492,7652,7607,7820,7692,7821,7784,7964,7537,7664,7722,7826,7754,7827,7849,7911,779
2,7868,7910,7941,7940,8061,7982,7983,1390,1391,1744,1907,1745,2012,2155,2528,1818,2154,2223,2626,2318,27
51,2753,3363,1819,2222,2308,2750,2387,2846,2967,3421,2512,2966,2888,3472,3089,3564,3624,4140,1906,2319,2
423,2858,2513,2957,3035,3534,2627,3071,3141,3565,3328,3674,3734,4256,2752,3171,3331,3720,3420,3789,3883,
4283,3465,3917,3996,4453,4029,4528,4628,5125,2013,2386,2604,3070,2682,3140,3303,3649,2782,3362,3184,373
5,3434,3833,3956,4364,2956,3330,3464,3916,3542,3971,4028,4491,3578,4037,4142,4580,4246,4670,4741,5254,30
43,3473,3566,4013,3675,4078,4174,4641,3769,4175,4282,4713,4380,4803,4875,5369,3919,4360,4474,4845,4512,4
882,4983,5466,4597,5017,5097,5545,5164,5632,5723,6221,2309,2529,2683,3329,2847,3393,3430,3943,2984,3435,
3543,4012,3579,4076,4095,4634,3088,3546,3625,4079,3721,4173,4271,4730,3832,4278,4361,4784,4490,4868,497
4,5429,3246,3668,3788,4243,3844,4279,4385,4853,3997,4466,4513,4892,4596,5009,5081,5544,4094,4562,4654,50
35,4714,5147,5172,5613,4823,5220,5328,5692,5399,5774,5926,6229,3273,3820,3970,4408,4069,4503,4589,5029,4
141,4616,4673,5124,4750,5165,5249,5659,4269,4731,4785,5211,4883,5294,5389,5794,4964,5416,5489,5876,5561,
5954,6004,6423,4384,4854,4930,5342,5060,5428,5503,5903,5155,5537,5622,5988,5698,6012,6154,6548,5247,564
2,5730,6083,5759,6189,6245,6621,5917,6275,6331,6612,6385,6703,6805,7126,2422,2783,2859,3535,2985,3547,36
58,4172,3034,3659,3742,4257,3874,4365,4409,4968,
3185,3743,3875,4438,3978,4475,4554,4969,4036,454
9,4629,5
096,4736,5154,5196,5612,3251,3957,4042,4452,4147
,4563,4655,5152,4187,4687,4751,5208,4802,5289,53
58,5756,
4186,4788,4858,5288,4955,5392,5433,5877,5066,551
7,5568,5951,5640,6000,6096,6507,3392,4133,4170,4
675,426
8,4766,4855,5255,4296,4874,4922,5373,4986,5458,5
527,5949,4617,4975,5061,5481,5130,5551,5637,5990
,5231,56
52,5738,6080,5801,6184,6258,6602,4765,5099,5209,
5597,5273,5691,5754,6156,5363,5790,5830,6220,592
7,6298,6
350,6677,5496,5919,5955,6332,5991,6387,6312,6731
,6125,6485,6549,6820,6557,6941,6995,7185,3431,42
64,4270,
4954,4568,5008,5080,5516,4686,5093,5131,5576,523
0,5656,5735,6158,4754,5218,5272,5657,5340,5755,5
809,623
2,5417,5839,5902,6290,5989,6343,6415,6741,4965,5
290,5353,5808,5432,5889,5965,6316,5572,5976,6008
,6409,61
34,6381,6525,6832,5683,6062,6170,6491,6233,6556,
6609,6890,6299,6615,6614,6979,6733,7017,7069,730
4,5098,5
412,5522,5977,5653,6009,6095,6451,5739,6157,6191
,6550,6268,6571,6613,6933,5816,6241,6320,6603,63
56,6619,
6737,7019,6443,6756,6797,7075,6866,7139,7182,741
7,5950,6340,6403,6739,6523,6750,6852,7096,6542,6
840,689
8,7159,6960,7211,7284,7500,6575,6948,7007,7235,7
052,7290,7260,7525,7123,7341,7370,7596,7434,7630
,7677,77
87,2605,2889,3042,3567,3170,3768,3882,4392,3250,
3918,3979,4433,4068,4539,4555,5138,3272,4043,413
2,4538,4
171,4767,4838,5246,4322,4844,4949,5368,5000,5445
,5523,5986,3302,4146,4265,4789,4330,4931,4980,54
22,4393,
5028,5084,5538,5146,5633,5680,6022,4467,5110,518
1,5644,5262,5734,5775,6142,5308,5757,5849,6240,5
868,628
8,6341,6815,3669,4323,4381,4987,4439,5085,5139,5
596,4581,5197,5240,5712,5317,5792,5838,6162,4674
,5245,53
52,5764,5419,5866,5879,6260,5480,5885,5900,6349,
6060,6388,6475,6834,4755,5418,5456,5896,5550,595
7,5985,6
363,5636,6059,6113,6442,6204,6510,6551,6905,5707
,6153,6236,6553,6304,6600,6685,6963,6395,6692,67
58,7028,
6798,7081,7148,7410,3712,4417,4548,5173,4672,524
1,5329,5800,4740,5359,5423,5888,5497,5907,5931,6
360,486
9,5457,5547,5933,5635,6048,6091,6436,5699,6140,6
202,6534,6261,6576,6653,6912,4981,5577,5671,6097
,5784,61
71,6163,6581,5817,6244,6280,6622,6369,6689,6711,
7033,5906,6305,6391,6704,6437,6769,6804,7100,648
4,6828,6
879,7160,6975,7225,7287,7509,5072,5722,5791,6246
,5878,6297,6377,6693,6043,6394,6460,6787,6464,68
12,6859,
7137,6063,6462,6483,6845,6597,6878,6952,7208,667
4,6972,7005,7236,7065,7314,7348,7534,6141,6611,6
642,691
5,6718,6985,7016,7273,6759,7057,7103,7338,7149,7
376,7427,7605,6885,7111,7173,7383,7232,7440,7467
,7667,72
75,7489,7523,7687,7567,7734,7779,7902,3845,4588,
4712,5362,4859,5449,5539,5995,4896,5560,5643,605
7,5713,6
120,6231,6659,5034,5681,5795,6159,5857,6295,6263
,6676,5892,6321,6384,6755,6456,6779,6818,7124,52
63,5828,
5893,6291,6042,6362,6404,6796,6056,6459,6473,681
9,6522,6862,6889,7191,6068,6504,6562,6887,6672,6
951,700
1,7239,6706,7045,7064,7321,7110,7349,7397,7589,5
316,6029,6045,6438,6073,6463,6533,6874,6152,6598
,6639,69
35,6690,6992,7054,7295,6390,6661,6730,7003,6763,
7078,7113,7343,6867,7120,7178,7389,7234,7436,745
5,7661,6
472,6768,6844,7080,6886,7156,7196,7407,6958,7221
,7246,7452,7291,7491,7532,7709,7014,7282,7330,75
22,7367,
7558,7588,7742,7414,7599,7625,7770,7646,7815,782
4,7971,5343,6081,6119,6651,6361,6681,6710,7043,6
413,675
1,6783,7087,6856,7131,7189,7399,6479,6816,6881,7
141,6927,7199,7249,7445,6994,7288,7241,7481,7344
,7527,75
66,7717,6675,6891,6950,7227,7031,7264,7323,7518,
7073,7331,7366,7559,7395,7569,7609,7765,7152,737
9,7424,7
593,7473,7634,7655,7803,7498,7682,7706,7838,7735
,7860,7864,7942,6766,6953,7070,7336,7127,7360,73
80,7582,
7183,7431,7442,7618,7483,7635,7695,7822,7193,747
9,7520,7680,7564,7710,7715,7862,7601,7744,7761,7
879,779
6,7906,7923,8009,7298,7550,7560,7730,7614,7746,7
776,7885,7644,7802,7808,7918,7843,7924,7973,8030
,7673,78
35,7857,7952,7882,7957,7988,8051,7895,7992,8006,
8066,8020,8078,8087,8126,3942,3713,3247,4737,364
8,4635,4
242,5502,3821,4247,4331,5322,4432,5016,4893,5690
,4077,4416,4529,4948,4640,5210,5092,5897,4822,51
32,5248,
5623,5372,6049,5786,6355,4143,4569,4671,5153,483

9,5221,5393,5731,4897,5459,5295,6228,5573,5829,5918,6813,5001,5413,5645,5867,5536,5984,6149,6587,5714,6118,6044,6408,6259,6660,6465,7102,4297,4764,4852,5341,4982,5444,5603,5932,5111,5763,5467,6005,5682,6069,6188,6482,5219,5569,5859,6143,5787,6348,6112,6543,5658,6203,6386,6610,6294,6872,6702,7340,5309,5856,5715,6269,6013,6230,6424,6641,5916,6505,6330,6776,6405,6717,7044,6940,6082,6450,6527,6899,6586,6788,6833,7138,6643,6973,6877,7283,7029,7472,7209,7656,4502,4923,5073,5546,5180,5641,5762,6155,5291,5948,5693,6210,5831,6266,6368,6738,5388,5785,6023,6289,5901,6474,6333,6707,6072,6412,6563,6799,6511,6854,6955,7176,5488,5994,5869,6380,6190,6457,6577,6825,6148,6665,6478,7056,6623,6894,6913,7242,6274,6560,6754,6954,6691,6991,7092,7494,6821,7122,7036,7271,7188,7351,7396,7700,5634,6058,6237,6535,6124,6596,6713,6971,6313,6780,6638,7155,6835,7004,7083,7320,6389,6684,6855,7048,6934,7114,7238,7363,6757,7203,7130,7444,7280,7416,7524,7758,6461,6884,6961,7213,6786,7161,7255,7549,7015,7310,7357,7454,7184,7597,7501,7944,7068,7339,7388,7583,7419,7529,7568,7813,7286,7622,7647,7729,7676,7887,7778,8071,4715,5133,5244,5765,5398,5956,5848,6354,5448,5884,6172,6422,6028,6500,6570,6876,5602,6090,5987,6532,6185,6705,6468,6932,6296,6599,6736,6984,6650,7136,7079,7485,5706,6211,6121,6814,6402,6580,6658,6993,6267,6688,6767,7228,6841,7039,7115,7371,6439,6875,6789,7154,6962,7095,7233,7413,6909,7202,7268,7439,7319,7506,7591,7724,5793,6524,6247,6719,6342,6888,6778,7172,6469,6824,6943,7125,6990,7212,7274,7474,6608,7049,6914,7353,6863,7230,7265,7571,7121,7307,7377,7510,7415,7547,7627,7833,6680,7074,6988,7285,7143,7342,7441,7613,7224,7480,7359,7578,7394,7685,7650,7807,7018,7430,7528,7671,7490,7640,7752,7800,7561,7732,7701,7874,7789,7853,7907,8082,5964,6376,6552,6873,6640,6926,7086,7294,6716,7180,6959,7337,7037,7248,7418,7611,6490,7002,7071,7392,7158,7507,7356,7595,7247,7449,7484,7678,7306,7743,7648,7972,6817,7101,7210,7542,7297,7466,7437,7720,7142,7496,7585,7666,7557,7696,7769,7859,7381,7573,7526,7707,7612,7817,7749,7881,7651,7780,7836,7917,7809,7900,7989,8029,6880,7231,7329,7495,7181,7619,7533,7728,7411,7546,7675,7762,7584,7788,7840,7936,7272,7641,7603,7795,7681,7856,7811,7932,7740,7828,7890,7913,7873,8005,7978,8054,7451,7711,7658,7851,7767,7948,7830,7967,7623,7892,7865,7986,7878,7997,8019,8141,7703,7939,7919,8034,7905,8012,8044,8092,7961,8039,8027,8109,8063,8161,8100,8173,5067,5323,5526,6001,5670,6061,6173,6574,5758,6351,6135,6740,6262,6620,6808,7082,5858,6205,6425,6664,6317,6923,6732,7135,6501,6858,6989,7350,6829,7177,7226,7516,5930,6414,6357,6782,6526,6853,6970,7240,6673,7053,6895,7192,7032,7281,7405,7577,6601,7000,6949,7270,7094,7372,7322,7551,7157,7393,7448,7777,7476,7660,7626,7850,6094,6458,6652,6922,6781,6974,7206,7305,6561,7006,7112,7352,7038,7435,7361,7604,6762,7140,7179,7505,7072,7404,7482,7674,7289,7521,7429,7643,7570,7702,7747,7899,6908,7198,7328,7453,7254,7543,7511,7719,7378,7616,7579,7697,7504,7753,7783,7888,7237,7633,7600,7763,7679,7829,7804,7933,7563,7797,7844,8001,7872,7977,7956,8075,6281,6809,6618,7093,6712,7318,7055,7477,6942,7134,7243,7463,7220,7426,7538,7725,6904,7382,7269,7590,7197,7519,7499,7757,7358,7565,7645,7705,7615,7790,7814,7921,7030,7299,7412,7548,7443,7670,7608,7834,7311,7594,7714,7806,7642,7781,7863,7949,7478,7698,7669,7819,7759,7894,7846,7969,7745,7870,7926,7984,7904,8008,8016,8115,7153,7488,7362,7657,7425,7624,7708,7854,7517,7786,7686,7839,7731,7877,7891,7990,7562,7764,7721,7901,7818,7884,7937,8052,7798,7959,7908,8004,7950,8026,8041,8090,7602,7727,7831,7920,7782,7934,7966,8021,7867,7996,7946,8038,7985,8047,8065,8107,7852,7970,7998,8083,8018,8056,8070,8129,7954,8077,8094,8122,8101,8135,8148,8178,6506,6857,6777,7261,6978,7315,7229,7535,7042,7190,7428,7672,7373,7572,7631,7799,7097,7398,7345,7592,7497,7748,7617,7825,7475,7649,7699,7876,7726,7845,7909,8000,7207,7508,7450,7659,7556,7684,7704,7855,7406,7718,7768,7912,7810,7897,7886,8011,7598,7771,7832,7883,7801,7927,7951,8032,7756,7962,7922,8023,7980,8049,8062,8117,7296,7438,7610,7766,7 539,7741,7823,7915,7668,7861,7791,7898,7654,7938,7955,8037,7694,7812,7837,8003,7866,7947,7974,8086,7893,7994,7963,8046,8015,8057,8080,8125,7733,7842,7916,7975,7875,8024,7995,8067,7943,7987,8033,8073,8007,8105,8088,8132,7903,8022,8045,8091,8058,8112,8102,8145,8040,8097,8123,8153,8116,8139,8157,8181,7462,7576,7632,7816,7716,7889,7805,7960,7683,7847,7841,7991,7880,8010,7981,8079,7760,7925,7871,7976,7945,7999,8035,8072,7914,8025,8043,8089,8017,8098,8111,8144,7794,7896,7968,8013,7935,8048,8028,8095,7953,8036,8055,8127,8076,8103,8106,8152,7993,8069,8085,8110,8064,8133,8118,8150,8050,8121,8138,8165,8131,8156,8163,8187,7858,7958,7979,8068,8014,8042,8084,8113,8002,8053,8074,8119,8093,8136,8128,8159,8031,8081,8096,8134,8104,8124,8143,8169,8108,8147,8140,8162,8151,8167,8171,8190,8059,8099,8114,8142,8120,8146,8155,8166,8130,8154,8149,8174,8160,8175,8170,8186,8137,8158,8164,8176,8168,8177,8179,8183,8172,8180,8182,8185,8184,8191,8188, 8189]

**Sequence group 6: Q6_16384**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1026,520 ,288,528,192,544,70,44,131,81,50,73,15,320,133,52,23,134,384,76,137,82,56,27,97,39,259,84,138,145,261,29,43,98,515,88,140,30,146,1028,71,262,265,161,576,45,100,640,1025,51,148,46,75,266,273,517,104,162,53,193,1032,152,77,164,768,2048,2049,268,274,518,54,83,57,521,112,1024,135,78,289,194,85,276,522,58,168,139,99,86,60,280,89,290,529,524,196,141,1040,101,147,176,142,530,321,31,200,90,1056,545,292,322,532,263,149,102,105,304,296,1030,163,92,1033,47,267,385,546,324,208,386,150,153,165,106,55,328,1088,536,577,548,1034,113,154,79,269,2050,2052,108,578,224,166,519,552,195,270,1041,641,1036,523,275,580,291,59,2056,2064,169,560,114,277,156,87,1152,197,116,170,61,1042,531,525,642,281,278,526,177,293,388,1057,2080,2051,91,584,769,198,172,120,201,336,4096,4097,4098,4100,62,282,143,1029,1044,103,178,294,93,1058,644,202,592,323,392,297,2053,2112,770,107,180,1280,151,209,284,1027,648,94,204,298,400,608,1089,352,325,533,155,210,305,547,300,109,1048,184,534,1060,537,115,1090,167,225,326,306,772,157,656,329,110,2057,2054,117,212,171,1038,776,1064,330,1153,226,549,1043,538,387,308,216,416,271,279,2065,2058,158,337,550,672,1092,118,332,579,540,1072,389,173,1037,121,553,199 ,784,179,228,338,2066,2176,312,1536,704,1154,2060,2081,390,174,554,581,1046,393,283,122,448,353,561,1096,203,63,340,394,1049,1281,527,582,556,181,295,1059,285,232,2113,2068,124,205,182,643,1156,562,2304,2082,286,585,299,354,1045,211,401,1104,4104,4112,4128,4099,185,1061,396,344,586,645,1282,593,535,240,1050,206,95,327,564,800,2072,2084,402,356,2055,2177,307,301,417,1160,213,1066,568,1120,832,588,4101,4160,4105,4102,1035,1537,186,646,404,1091,227,896,594,418,302,649,2114,2560,771,360,539,111,1052,331,1168,214,2059,2088,309,1062,1284,188,449,1073,217,408,609,596,551,650,229,159,420,310,1093,541,2116,2178,4113,4106,4114,4224,1288,773,610,657,333,1065,119,1098,600,339,1184,218,368,652,1031,230,8192,8193,8194,8196,8200,8208,8224,8195 ,391,313,450,542,1538,334,2067,2061,2096,2062,1076,233,555,774,175,123,1155,658,2120,2305,612,341,777,220,314,1105,424,1068,395,673,583,355,4108,4129,4161,4116,1296,1094,287,183,234,1051,2069,2180,125,557,1216,660,616,342,2083,2306,316,1157,241,778,563,1074,345,452,397,403,1112,207,2074,2561,1540,674,558,785,1100,432,1039,357,187,1162,236,664,1312,624,587,780,1080,1122,2128,2085,705,126,242,1063,2073,2070,565,398,346,456,2184,2308,358,405,303,569,1544,244,1158,1097,595,1283,189,566,676,1169,1054,1108,361,706,4352,4130,4120,4132,589,1344,215,786,647,348,2312,2086,419,406,2562,2144,464,680,2115,2089,801,1069,362,1164,2192,2076,590,409,1286,570,1121,788,1552,1106,597,1075,572,1186,219,311,4103,4225,4162,4608,708,598,1289,601,651,421,792,802,2117,2090,611,1047,602,1172,410,231,688,653,2564,2097,1128,248,1070,369,2122,2320,190,364,1568,654,1095,659,1161,335,480,315,221,370,1285,613,4107,4136,4164,4226,1408,422,2208,3074,425,451,2568,2336 ,4115,4109,4144,4110,1077,614,543,1298,235,412,343,372,2576,2240,1185,775,317,1539,222,1099,426,453,237,1 124,559,1170,2592,2118,1292,833,804,712,1082,834,
661,1053,2092,2179,2129,2098,808,779,1217,617,60
4,1541,4
33,720,816,1101,2121,2063,1176,836,347,897,4168,4
353,4117,4228,1136,243,1297,662,1600,454,318,675,
2368,21
81,1110,618,4131,4354,4122,4609,1081,898,781,131
4,1220,376,428,1546,2100,2071,665,736,567,1107,21
82,2432,
8197,8256,8201,8198,8209,8202,8210,8320,1192,107
8,2124,2185,840,625,238,1159,359,457,399,787,2130
,2104,5
91,678,434,677,1290,1542,2075,2145,349,1300,1102,
245,1188,458,666,1113,620,1553,4176,4133,4121,41
18,1163,
1313,363,127,4232,4356,4360,4134,1067,191,1125,7
82,407,436,2087,2307,626,1218,2132,2186,571,465,2
193,230
9,681,246,707,1346,8204,8225,8257,8212,8448,8226,
8216,8228,2077,2091,2146,2563,350,1084,599,668,1
548,790,
2136,2188,1165,1320,460,1123,1200,249,682,1664,5
73,1171,411,803,4610,4192,4163,4137,1116,789,130
4,709,36
5,440,628,689,2078,2194,374,1224,3076,2119,423,15
56,4240,4124,4165,4138,466,793,2310,2313,2209,26
24,1130,
250,371,1174,2093,2148,481,574,1348,413,1109,603,
366,1545,1287,1055,468,1570,655,900,805,615,1166,
684,140
9,710,2688,3073,1187,429,4612,4145,4170,4368,819
9,8321,8258,8704,8203,8232,8260,8322,2099,2196,7
94,252,1
114,373,605,1232,848,690,2094,2123,713,632,2314,2
321,1316,482,806,1132,2565,2152,1083,427,1177,90
4,1569,4
14,2210,2101,1291,223,1126,1554,663,692,835,1328,
619,472,2241,3080,1137,455,4256,5122,4616,4384,4
624,428
8,4640,4166,2200,2125,796,1189,1601,809,714,1248,
721,837,716,1086,2212,2816,1302,1352,4140,4227,4
177,414
6,864,810,1173,606,1194,912,1103,722,696,377,2316
,2322,1424,435,2566,2102,1293,1560,817,1129,1792,
319,621 ,1180,8211,8205,8240,8206,8264,8449,8213,
8324,2131,2105,2569,2160,812,484,1345,430,1572,1
138,3072,2183,4
169,4111,4416,4229,1299,838,667,1219,2126,2337,4
88,1111,239,378,459,622,4148,4119,4230,4480,1410,
627,224
2,2133,437,380,1201,1608,818,1178,2324,2570,1294,
461,1543,496,669,1190,1317,679,2106,2216,1140,10
79,4172,
4233,4178,4152,2187,2147,1221,724,841,1305,629,1
584,2134,2108,351,467,2328,2137,1360,438,1115,73
7,2338,2
577,251,462,442,441,2572,2244,1666,469,1549,247,6
83,1196,2189,3088,2149,2195,4123,4193,4135,4355,
1226,84
2,1412,1127,738,1144,2224,2190,4180,4234,4241,43
57,1308,899,1602,670,1318,783,1085,849,4125,4139,
4194,46
11,1555,1193,820,1576,728,928,791,367,2578,2369,1
376,901,2079,2248,2138,3104,1233,630,2593,2340,1
321,685,
844,1204,633,711,2370,2580,2311,2197,2150,2153,1
118,253,691,1301,8227,8450,8218,8705,8272,8229,8
217,8214 ,824,1175,2352,2344,902,686,1668,1222,14
16,1133,740,1347,4184,4236,4126,4242,850,375,155
8,444,5124,4167,4
358,4361,1306,470,1167,483,4257,4672,4141,4196,1
547,415,3078,2211,485,905,2140,3081,4736,5121,41
47,4244,
1202,795,473,1240,2095,2315,634,744,2433,2594,16
16,852,2372,2256,2434,2198,960,1322,2201,2213,86
5,693,21
54,2103,1131,1794,1350,797,8328,8452,8456,8230,8
706,8288,8259,8233,1225,1604,1571,906,2376,3136,
1252,715 ,1141,1330,807,474,636,1179,694,254,4142
,4171,4362,4369,1550,1665,2584,2625,717,1071,259
6,3082,1315,575,9
13,1440,798,811,379,1208,4613,4200,4258,4149,216
1,2202,1353,1191,2127,2317,697,1564,4289,5128,42
48,4173,
431,1142,607,1228,2156,2626,489,1324,2272,2214,8
66,723,2567,2600,486,1573,1181,1234,908,1793,156
1,718,81
3,1364,2243,2318,476,856,8336,8220,8261,8234,870
8,8241,8266,8464,3089,2689,1117,1411,4260,4864,6
144,6145 ,839,1329,1295,1146,4364,4370,4614,4150,
8352,9218,8712,8480,8720,8384,8736,8262,3084,257
1,725,698,1472,9
14,2323,2628,1249,752,868,819,1349,814,439,929,41
79,4153,4617,4208,2339,2107,1197,1578,490,1139,2
217,260
8,1680,623,2162,2325,1632,1336,671,1198,1362,739,
2204,2135,1603,1557,3200,2245,5120,4231,4174,438
5,2164,
2218,1413,916,1303,463,1236,843,2109,3090,1135,3
81,1672,1354,2579,2573,4290,4181,4372,4618,4154,
4264,423
5,4195,497,1586,930,821,2690,2329,726,961,1203,11
82,2326,2574,872,1418,492,1250,1332,631,2225,234
1,4182,4
156,4376,4185,2436,3105,1574,1223,729,1145,1605,
700,8236,8323,8273,8242,8265,8207,8512,8325,2139
,2632,17
96,443,2817,2246,1307,741,2220,2168,1378,1562,13
56,1205,845,1319,4386,4625,4620,4292,2249,2384,9
20,382,8
244,8215,8326,8576,8268,8329,8274,8248,2110,2330
,1585,822,1425,851,2191,3077,3092,2151,1229,730,1
609,498 ,2226,2342,4237,5136,4197,4243,880,1256,7
42,445,1392,471,2141,3106,4272,4238,4626,4417,26
92,2250,2640,23
71,4127,4296,4186,5152,635,1148,1696,932,1580,68

7,2440,2345,1210,1420,1612,1325,1800,903,1134,82
5,4641,4
388,4418,4628,1235,1361,500,1577,846,1670,1195,7
45,2818,2155,2228,3328,4359,4245,4198,4201,826,7
32,2199,
2257,2332,3075,1264,446,2696,2142,962,1426,1620,
936,2252,2346,1377,475,2448,2656,8219,8289,8231,
8451,827
6,8330,8337,8453,3137,2400,2373,2581,853,1310,86
7,637,8221,8235,8290,8707,8280,8332,8222,8338,22
03,2258,
1551,1230,2353,2595,1414,907,1206,1667,1588,1333
,4400,4392,5126,4259,487,1808,2348,2157,4188,512
9,4143,4
363,695,1441,1087,746,4481,4642,4420,4304,828,75
3,1610,854,1237,1326,3096,2232,4482,4246,4249,42
61,4202,
4151,4424,5184,857,1368,2582,3108,1209,504,799,1
355,2585,2163,255,964,4632,4673,4644,5130,3138,2
215,2273 ,2374,1242,909,2354,2820,2205,2704,1673,
1559,1309,719,2377,2158,1143,477,2165,2260,1617,
915,1448,1380,92
20,8263,8454,8457,8353,8768,8237,8292,2219,3086,
638,748,2824,3112,944,1728,1331,1227,869,1592,14
28,491,6
99,1253,4209,4250,4175,4365,1351,754,2378,3201,6
146,6148,4204,4674,1183,1565,2274,2597,8832,9217
,8243,83
40,8238,8267,8458,8465,858,1618,1417,1476,4320,4
262,4615,4648,4291,4366,5137,4737,3091,2586,478,
968,1260 ,383,2435,2356,5132,4619,4371,4676,1212,
910,1801,815,2264,2464,1579,976,2319,2327,870,16
84,1633,917,2206,
2385,2598,2720,3140,2166,1337,1241,2380,2627,160
6,1824,727,1150,1442,493,1357,1251,2588,3120,167
6,873,24
37,2221,1384,701,4387,4155,6152,6160,3085,2169,1
566,931,8709,8296,8354,8245,8385,9224,8344,8269,
4265,465
6,4210,4373,1323,1798,1365,1473,2601,2247,756,13
34,860,499,2832,2227,731,1648,1238,823,4252,4183,
5248,42
93,1575,922,1199,1674,4212,4266,4157,5138,2276,2
386,874,1432,1421,918,2360,3584,4627,4621,4738,4
377,2752 ,3202,1636,1254,2438,2222,502,1795,2602,
2629,933,1366,4374,4622,4273,4389,3094,2441,1338
,1682,2331,2170,
2496,2401,1587,1211,1488,743,1358,760,2609,3144,
1244,1581,881,1147,4484,5153,6176,6147,2251,2111
,494,137
9,8356,8960,10240,10241,8460,8466,8710,8246,8275
,8249,8713,8304,9216,8327,8270,8481,4187,4680,48
65,4294,
1272,702,2388,2442,3097,3329,921,1624,501,876,25
75,2630,1415,847,1856,1444,992,1697,2604,2229,42
68,4216,
4297,4432,2343,3107,2333,2280,8386,8277,8468,871
4,8250,8360,8331,8291,447,1607,1436,1369,2172,22
53,1257,
1704,2230,2691,733,1797,3204,2610,1669,1340,1231
,827,1590,934,4158,4378,4239,5125,2334,2633,1634,
1474,51
40,4199,4274,4390,2347,2402,3093,2259,882,937,24
49,3152,2233,3109,963,1419,747,1265,2444,2392,41
89,5154,
4740,4298,4688,4419,4488,4393,1119,505,1381,855,
2634,2693,924,1810,3330,2641,2583,2288,6149,6208
,4866,42
03,8278,8252,8472,8281,8482,8721,8716,8388,3098,
2254,734,829,1563,1213,2143,2375,4276,5376,4247,
4305,161
1,1363,2612,2848,1430,1258,1688,1386,965,1614,17
30,1239,8333,9232,8293,8339,8368,8334,8722,8513,
2450,240
4,938,884,4380,5123,4744,4190,506,1327,1589,1804,
2355,2349,2465,3208,749,1370,2261,3114,4300,4394
,4496,4
704,2616,3168,1640,945,2880,2636,966,1456,1681,7
55,3083,3585,2234,2694,1266,859,5185,4448,4421,4
629,2452 ,3139,2275,2944,8223,8392,8282,9248,873
7,8484,8514,8724,4251,4306,4401,4643,2642,2466,1
427,1593,1388,940 ,2350,2697,1214,830,2819,2408,4
396,4205,5144,4280,1809,911,1621,1582,4630,5156,
4633,4211,2587,2159,1832,
871,3100,2379,639,1480,5186,4263,4321,4422,1698,
1335,888,1372,1245,479,1422,1268,4402,4868,4253,
4752,321
6,2262,946,1732,2357,3110,1677,750,1802,1626,333
2,2236,4425,4206,6153,6150,4213,4308,4267,5134,8
455,8341 ,8294,8297,8496,8488,9222,8355,2497,312
1,1393,969,2265,2456,2657,2644,508,1613,2599,269
8,4872,5160,4426,
5249,8284,9225,8239,8459,8577,8738,8516,8400,227
7,2207,861,1446,2468,2358,1857,1339,3141,2589,75
7,1382,3
336,2821,970,1700,8578,8342,8345,8357,8298,8247,
8520,9280,2658,2705,2381,3113,1243,919,2167,3146
,1594,14
33,1826,1504,875,1635,1259,862,4322,4645,5139,46
34,2648,2387,1920,1675,4483,4404,4312,4512,4367,
4375,616
1,6154,3232,2266,1445,758,4254,4433,4646,4768,24
16,2700,1149,948,1359,1816,3079,2278,1596,1671,1
712,977,
5188,4214,4428,4675,4636,5168,4485,4269,5133,421
7,4649,4295,2439,2361,1385,923,1622,972,2498,259
0,1434,1
311,3586,2382,4880,4275,4324,4434,1729,761,1396,
877,3124,2281,2603,2822,2223,2171,3203,2706,1207
,1475,26
60,2389,8728,8769,8740,9226,8305,8346,8271,8461,
1449,1812,952,1686,2825,2268,495,1262,10242,1024
4,8300,8
770,8416,8358,8711,8744,2362,3153,1644,1619,2472
,3116,1341,1429,8387,8462,9233,8833,9228,8715,84
67,8772,

2443,2721,1825,703,6162,6272,4408,5632,1371,1638,1567,1736,4800,5250,6156,6177,8483,8251,10248,10256,83
61,8752,8306,8469,2631,2403,935,1685,978,1625,3344,3142,4486,4270,4650,4677,883,762,1246,503,5142,4489,4
379,4218,2335,2231,1458,925,4544,4449,4657,5192,4299,4159,4436,4490,1394,1269,2282,3099,5145,5377,4623,4
678,878,1478,735,1799,4652,4277,4391,5155,2173,2605,3264,2708,2664,2390,1678,1860,2364,3205,2289,2826,26
11,3122,1443,1637,4381,4328,6209,6164,2393,2500,1481,1373,2445,2451,3160,2255,1699,1255,993,1591,1828,14
52,3588,2722,885,939,994,1400,8348,8279,9344,8389,8308,8362,8253,9234,2606,2833,3148,2480,4220,4301,4278 ,4739,1744,1656,3087,2405,5252,4658,6400,6178,2235,3210,980,1689,926,764,2284,2712,1270,941,1628,1367,18
05,1457,3360,2672,8723,8717,8834,8473,84
70,8718,8369 ,8485,4382,4681,4395,4450,2635,2828,3128,3170,5141,4
307,4497,5200,1921,1583,2753,2174,8580,9249,10272,10243,8283,8776,8961,8390,1387,1642,2290,3111,967,126
7,2613,2446,4281,5157,4492,4440,1484,1450,2394,2504,4682,4741,5378,4689,886,831,1683,1342,4631,4336,5146 ,4302,1811,947,2406,2453,2351,2617,3592,2292,1705,1431,3206,3145,2643,3331,507,1261,1840,889,2237,2614,4
191,4423,4660,4896,1650,984,1760,1490,6168,6180,4498,4452,2724,3217,3102,3156,8364,8312,8393,8528,12288,
12289,12290,12292,1615,751,2409,2754,2637,3392,2263,2834,8254,8474,8335,9221,9236,8295,8370,8486,6151,6
273,4403,4397,1702,942,1858,1423,2695,2396,1460,1383,4513,5256,4309,5162,2467,2454,996,1692,1641,1814,97
1,1477,2512,2728,1273,1512,1733,890,1598,1374,8285,9250,8836,8394,8784,8515,8584,8489,4664,5216,4928,468
4,2849,3117,2410,3212,509,1806,2638,2457,5131,5633,4282,4742,3334,2618,1922,1649,4500,5187,4323,4992,316
9,2836,3600,3154,949,973,2645,3123,2620,3234,1397,1489,4690,4514,4398,4745,2267,2359,2756,2646,6210,6656 ,4867,4456,10245,10304,8962,8299,8372,9472,8343,8401,4635,4207,5148,4427,3337,2649,1708,1627,2699,2469,1
000,1690,2840,2850,892,1274,5264,4310,6155,6184,2659,3095,1438,1817,2650,3220,2458,2279,4405,5158,5380,4
284,8476,9219,8840,8286,8396,8490,8592,8800,9281,8544,8517,8725,8347,8402,8497,8739,1390,1464,2736,2701,
1868,950,1151,1731,4545,5169,4313,4504,1506,1827,1597,863,3176,2296,3118,2417,4705,4692,4647,4746,1451,7
59,2238,2412,1864,1714,3616,2702,3143,2707,1701,1395,4325,4255,4516,4406,8492,8301,9240,8376,8726,9252,8
729,8307,5189,4637,6212,6274,3209,2383,2528,2363,1803,1008,2269,2418,3333,2661,1623,1482,5384,4869,4706,
4753,3456,2470,1276,510,4429,5161,4215,5194,2473,2499,1435,1652,4696,4435,5280,4314,3125,2662,2591,3346,
2283,2460,2391,2420,979,1492,3233,2823,9282,8359,8417,8518,8498,8964,8349,8848,4464,4748,5127,4326,953,1
928,1829,1389,4487,4409,4546,4638,2365,3587,1738,763,2270,3147,1872,974,5634,4430,6163,6157,6192,6158,51
72,4329,2474,2501,1453,1643,2285,3172,1713,1818,4651,4870,4271,4219,8521,8302,10249,10246,8309,8404,836
3,9230,1215,1402,2607,3218,1629,1520,1830,1691,3340,2881,954,1459,5251,4754,6216,6401,8968,9256,8522,934
5,8418,8741,9235,8730,4708,4437,4873,4316,4410,5201,4520,5164,8579,8500,8408,8608,8463,8471,10257,10250,
1734,879,2852,2760,3130,2882,981,1505,2709,3101,1706,982,4491,4769,4679,4451,2856,2827,3265,2665,2652,35
89,2481,2768,2864,3149,1924,927,3224,2884,1833,1639,8350,8529,8742,8864,9284,8310,8524,8771,2395,2945,31
84,2291,1447,1746,3345,2710,1343,1679,3648,2502,2366,2723,1820,1761,5392,5190,4383,4279,4330,5147,6165,6
276,8732,9264,8581,8365,9229,8313,8745,8391,1479,1275,995,1740,4221,4653,5312,4756,4712,4438,6179,6402,3
158,2666,1401,1888,4412,5253,4337,4874,765,956,3129,2946,2829,3362,1496,1861,4659,5170,4441,4548,3268,24
24,887,1437,4493,4499,5208,4303,6170,6657,5636,4770,4654,4881,5196,4528,985,1720,2476,3594,997,1630,1813 ,1462,5135,4453,4283,5258,2713,2784,2615,3155,4332,4760,5408,4720,3240,3126,1398,1645,2888,2673,2286,320
7,2407,2505,2447,2835,8976,8371,8420,8530,10258,10368,8504,9728,1848,1687,2639,2726,4683,4876,5176,5218,
8896,9346,10252,10273,8582,8366,8746,8773,1247,1716,2482,2725,3338,3590,1936,986,9238,8585,8475,8314,86
40,8545,8753,9288,1483,1651,1745,943,2397,3348,1859,1508,3150,2293,3236,2506,6224,6181,4801,4222,8395,82
55,8532,8586,9241,9473,8719,8774,8748,8373,8487,9251,8477,8424,10305,10260,1834,1454,2714,3161,4338,515 9,6169,6166,2668,3601,891,1841,998,1595,3211,3361,4661,4494,4442,4552,1278,766,1465,1709,8316,8397,8374,8835,9348,8754,10496,10274,6280,6404,4454,4501,4399,4665,5640,4340,2411,2175,1764,1646,5254,5193,4691,5379,4285,4662,4772,5265,3115,2239,3173,2830,2455,2484,1737,511,5150,5204,4457,4802,2674,3266,1485,1404,4685,5440,4311,4882,2619,2513,1693,1866,2729,2294,2755,3394,4743,4444,6408,6182,1952,1491,988,1657,4515,4502,6658,6240,1752,1807,2398,3132,2647,2716,3596,2838,1399,1844,3213,3368,2508,3171,1001,951,1654,1926,3248,2297,8478,8777,8491,8546,9237,8403,8593,9296,2730,3712,1707,1391,4560,4776,6211,6185,12296,12304,12320,12291,8377,9253,8588,8536,2621,3219,2459,2851,4897,5165,4458,5260,1002,1468,3164,2837,3352,2757,2413,2488,8778,8837,9474,8785,8727,8432,9242,8398,8287,8519,8756,8992,10264,10276,8594,8548,6288,6172,4686,4505,1836,1494,1873,1271,2676,2737,1694,893,5382,4666,5217,4884,10247,10369,8499,8493,8609,9352,8405,9258,2422,3272,1923,1461,2471,3604,1748,1715,5648,5202,4693,5171,2514,2841,975,1862,4668,5282,4315,4407,894,1815,3178,2298,2419,3222,1497,1653,4804,4694,5385,4697,4747,4517,4888,4898,6213,6186,4707,5143,2529,2622,3396,2461,4698,5268,4506,4327,3157,2651,2414,3593,1510,1762,3335,3103,2516,3618,1842,1375,2703,2948,2853,2663,4784,4749,6660,6193,3214,2732,1703,1009,5224,4344,5166,4465,3457,2758,1466,1874,8760,9312,9024,8780,12293,12352,12297,12294,6218,6416,4286,4460,3235,2477,955,1739,9227,9729,8378,8838,8596,9283,8419,9088,2842,2300,3162,2421,2653,3280,2896,2738,5664,4750,5191,4755,1486,1930,2761,2680,1889,1004,1658,1821,5257,4431,4576,4411,1718,1929,3364,2530,2854,3180,1599,1507,8786,8610,8494,8841,10306,10752,8963,8552,3131,2475,1776,1405,3225,2952,3617,2462,8731,8303,9244,8523,9360,8406,10251,10280,4317,4466,5381,4709,1735,1831,3339,2271,3174,3602,1493,1010,5504,4518,6304,7170,8501,9254,9476,8380,8641,9265,8409,8600,4521,4547,6664,6432,2711,2740,2883,3376,5173,4710,4639,5394,1984,1455,2667,2520,4331,4508,4439,4468,957,1865,3185,2503,8801,8788,8743,8842,8421,8351,8612,8502,6672,6336,5281,4871,2844,3237,3649,2857,4413,5635,4318,5195,4522,4549,4333,5220,2762,3296,2769,2885,2764,3134,983,1710,3350,3400,958,1514,4655,5266,6688,6214 ,2912,2858,3221,2654,1876,1768,3242,2960,9285,8733,10308,10370,12305,12298,12306,12416,5388,4929,4900,4808,1721,1938,3151,2770,9480,8965,8802,8849,8525,9257,8311,9290,2744,2425,1660,1500,5178,4930,4757,5149,6188,6275,6225,6194,1403,1892,3472,2483,1819,1741,1516,987,4904,4875,5313,4713,3341,3608,1932,1463,2865,3177,3840,2367,1012,1843,2669,3228,4700,5637,4529,4816,8792,8531,9376,8410,8560,8844,9223,8422,4912,5197,6217,6159,5272,4932,4443,4993,1749,999,2860,2532,3393,2478,3620,3186,5232,4339,5393,4758,3347,2886,2715,3267,5696,4550,4414,4771,1838,1277,2536,3159,6464,6277,5206,4714,2287,2426,2507,2670,3458,2675,1647,1925,2485,2428,1498,1742,8583,8505,8642,8734,9730,8526,10259,10253,5177,4994,4877,5410,3249,3656,2866,3226,10288,10254,9268,8425,8747,8966,8367,8315,5316,4472,4524,5642,6196,6167,4761,4832,1513,1880,1717,1016,4663,5203,6278,6528,5288,5174,6220,6281,1953,1837,3342,2509,1867,1631,3591,2544,4936,4721,4334,5255,9347,8850,10312,10497,8804,8533,8969,8412,8506,9297,8616,9260,8587,8865,8775,8547,2717,3238,1469,1747,3365,2727,767,1904,4455,4553,4495,4883,1724,1524,3188,3127,6226,6200,4687,4774,4530,4773,5386,5638,12300,12321,12353,12308,9488,9286,8479,8375,6171,6241,4445,5396,989,1406,1754,1822,3269,2772,2889,3353,5198,4341,5284,4554,8426,9243,10261,10372,8317,8749,9408,8852,2677,3632,2399,2515,4762,5209,4716,5649,3408,2486,3163,2785,2299,2510,2490,2489,1835,1499,3714,2517,3597,2295,2731,3244,5259,5409,4459,4223,1944,1863,1890,1467,8808,8534,10275,10498,8508,9349,8433,8970,1003,1522,3274,2890,3460,3175,2786,3192,5163,4287,5221,4878,4503,4532,6183,6403,1763,1695,3356,2947,4722,5314,6228,6282,8755,9266,8537,8644,8589,8595,9304,8399,4667,4561,6289,6405,3650,2718,1850,990,4777,4342,4803,5442,1005,1937,3366,2831,3133,2897,1722,1845,6173,6187,6242,6659,4446,5180,4695,4764,3603,3241,1495,1655,10266,10753,9732,8866,8750,8977,9292,8624,5644,4 886,6232,6284,5261,5416,4556,5219,9231,8549,8379,9354,8428,8856,9504,8816,5296,4345,4778,5760,2868,3624,
2776,2976,2839,2415,1765,1956,4669,5267,4507,4899,3424,2949,1487,1750,5212,4885,5400,4805,8779,8972,927
2,9314,10320,10277,8897,8318,3281,2678,1869,1521,3369,2733,2892,3252,8434,9255,10265,10262,8757,8590,85
38,8648,4461,4536,4724,4785,2681,2759,959,1896,6174,6290,4470,5320,1263,1940,3166,2301,10376,10500,8550,
8597,8495,8761,9736,8436,2739,3349,2872,3223,1770,1877,2950,2734,3716,3270,1509,1711,3464,3181,2788,339
5,9350,9289,8787,9475,8381,8758,8868,9361,7172,6215,4519,5652,1756,1846,2898,2423,4562,4889,6406,6409,36
06,2492,1011,1960,3354,2518,3215,2531,6305,6720,5226,4346,9246,9300,8553,8898,12544,12322,12312,12324,8
781,9536,8407,8978,8839,8540,10504,10278,4467,5270,6189,6244,3595,2463,1784,1870,4577,4670,5444,4509,52
05,4699,4462,5641,1662,1013,2533,2953,5383,5151,4564,5666,8611,8598,10754,10336,8656,8872,10307,10281,4
751,4996,4901,4711,1985,1753,3250,2843,5262,4780,5505,4806,2521,3288,2682,2792,6784,7169,5283,4525,1927,
1528,3664,2900,6195,6292,4890,4348,1849,1882,3008,3370,5210,4469,4701,5328,4944,4786,6190,6219,2913,274
1,1766,1511,4809,4728,6410,6417,3179,3842,3398,2845,3273,3652,3619,2954,1954,1719,3300,2763,3189,3378,17
77,895,8993,9261,8554,9356,10384,10268,8782,8601,5412,4578,4902,5228,2855,2522,2684,3227,9478,8762,9313,
8980,9744,9298,8789,9267,8764,9378,8411,8503,12295,12417,12354,12800,6661,6248,5179,4523,2742,2302,1439 ,1006,8900,8790,9481,8793,8843,8613,8984,8994,5273,5000,5665,4510,3598,3713,1878,1891,2765,3119,3363,262
3,6306,6197,5387,4319,2961,3488,2846,2859,2427,3256,1939,1661,10309,10282,8803,9239,8794,9364,8602,8423,
8880,8845,10756,10289,9320,8440,9262,8561,10314,10512,8382,8556,9760,8846,9287,8851,5222,5650,4759,4788 ,3401,3239,1502,1986,2745,3612,1852,1934,4931,5424,4715,4568,2479,3190,2655,3276,6337,7176,5233,4551,935
3,8527,8672,8507,8413,8562,9477,8805,2537,3372,1723,1772,2914,2771,1515,1897,6296,6221,4892,5285,5697,49
05,4810,5344,4817,4933,4812,5182,6308,6912,5398,5448,2534,3621,3229,3282,4960,4906,5269,4702,2956,3841,3
609,2766,1014,1470,2861,3412,5290,5008,5199,4818,1743,1931,2524,2904,4792,4473,6412,6418,3165,3459,2887,
3377,5520,4531,6662,6198,3343,3194,2773,2746,5389,5656,4913,5225,3520,2962,1017,1968,12299,12328,12356,
12418,9600,8614,10400,11266,3297,2800,2916,2867,3397,2862,2487,2977,8617,8643,10760,10528,12307,12301,1
2336,12302,5888,4415,4717,5276,1881,1894,3245,3626,1769,1517,2538,3187,6227,6201,6665,6256,9269,8806,87
35,9490,8427,8604,8535,8564,1778,1941,1823,1659,3728,2671,1992,1875,10768,10432,9377,8967,8509,9731,841
4,9291,4908,4580,5441,4526,3680,3384,1755,1501,8618,8645,8429,9316,8751,9362,10784,10310,9484,9025,8996,
8904,9274,9026,8853,9245,2719,3246,3410,2787,5668,5234,7168,6279,10284,10371,10321,10290,9000,8971,9409 ,8809,1018,1900,3651,3605,1725,991,3461,2964,8796,9733,8625,8912,9008,9293,10313,10255,5395,4934,4763,53
15,6222,6433,4584,5207,4335,4474,4555,4718,3351,2511,3284,2891,5506,4723,6338,6229,4533,4476,5297,5704,4
914,5274,6420,6666,3183,2429,3720,3402,9368,9028,8539,9089,12360,12545,12309,12420,5390,4557,5639,4592,
2545,3634,2978,2869,4765,5286,5413,4775,6202,6312,5236,5175,2774,3009,3251,3230,1933,1839,2920,3466,254
0,3298,3380,2679,6283,6243,5317,4820,1525,1955,1988,1884,1726,1948,3622,3271,4937,5401,4725,5680,6230,62
04,4447,4563,9328,8435,9489,8854,9792,8646,8510,8867,2777,3193,3653,2748,6424,6233,5456,4534,10560,1037
3,9302,8810,12323,12546,12314,12801,5211,4833,6434,6673,1780,1518,3844,2491,1020,1767,1905,1851,4347,45
58,4538,4537,3355,2789,1893,1945,3426,3610,3404,3253,2893,3367,2968,2430,6668,6340,5762,4565,9273,9090,8
973,9506,9412,8568,8620,9738,5645,4343,4779,5292,6285,7184,6245,6291,10292,10263,8857,8928,8759,9299,10
374,10624,3633,2870,3473,2899,5322,4938,5508,5223,3277,2778,3657,2546,4834,5240,6320,6286,1757,1530,292
8,3304,5404,4995,5698,4766,9384,9270,10316,10377,9032,8817,8430,9351,2790,2493,3440,2519,5414,4879,5181,
4945,8551,8649,8591,8979,10322,10296,8783,8870,1958,1471,1007,2000,2683,3196,3744,2980,8626,8869,9482,9
734,10267,10337,8541,9492,3628,2735,1847,1898,5651,5289,4916,5672,4824,5024,4887,4463,6674,6465,5472,49
97,3258,3468,3660,3373,6175,6344,6234,7200,5329,
4726,6689,6436,1523,1942,3848,2951,3182,2873,196
1,1871,5
417,4781,4940,5300,9294,8437,9380,8650,8858,9305
,8812,9745,3283,3409,1771,1529,2548,3625,2894,37
18,1236
8,12325,12313,12310,9355,9505,8555,8319,4729,480
7,6466,6676,6407,6293,6246,6249,3243,2793,1912,1
758,521
4,4349,4787,5397,4920,5271,6448,6440,4998,4782,5
764,5318,12424,12548,12552,12326,9259,8383,9317,
8974,28
74,2780,1989,1946,3312,2494,3010,3474,5512,5229,
4836,5443,3668,2984,3425,2523,8599,8628,10279,10
499,881
8,9410,10324,10378,4946,4471,5654,4540,1526,1906
,2901,3358,2915,2685,3599,3278,1883,1773,3462,29
55,5402,
4566,5263,4579,3254,3715,3636,3381,2535,3856,195
7,1853,2743,3489,3135,2794,8763,8657,10385,10501
,8873,8
438,8899,9538,5643,4511,7174,6307,4581,5001,6236
,7177,1976,1015,2876,2801,5298,4891,4569,5336,10
269,102
83,10338,10755,8542,9276,8791,8860,6191,6411,473
0,4840,3658,2902,3285,3374,9740,8982,10328,10380
,9357,9
512,8652,9315,6529,6690,5712,4948,6468,6352,6530
,6294,1751,1993,1503,1962,5056,5418,6297,6309,49
61,4789,
6250,6199,2905,3416,3257,2552,9392,8441,8874,985
6,8765,9363,8603,8995,5227,5890,5446,4893,5321,5
700,566
7,5002,12802,12384,12355,12329,9308,8981,9496,89
01,8557,8632,8820,8881,10270,10386,8566,9416,647
2,7232,
5348,4811,2847,3403,2303,3012,5237,5426,4903,457
0,1781,1885,3290,2957,4732,5275,4790,4350,1908,2
016,372
1,3607,11268,10311,8615,9748,12432,12316,12357,1
2330,5646,5761,6680,6721,3357,2767,3191,2525,481
3,5167,
6692,7178,5411,4671,5009,5536,8658,8985,10502,10
505,10401,10816,9322,8442,3665,2963,3496,3428,48
94,4907 ,4475,5304,2686,2796,1854,1532,2992,3776,
3379,3275,8563,9366,10285,10340,8673,8766,9540,8
605,2917,3640,3
476,2539,2747,3301,1972,1774,6257,6298,5449,5287
,6223,6413,4793,5660,9301,8795,8558,9737,9479,92
47,8660,
9762,3399,2802,1019,1895,4527,5238,4703,5324,323
1,3613,2906,3666,6252,6722,4585,5420,6368,6310,4
962,481
9,3465,3524,2526,3016,8847,9092,8997,8807,9358,8
876,9601,8902,10880,11265,9379,8621,12804,12337,
12362,1
2560,6663,6696,4582,5669,5277,5330,5004,5889,330
8,2431,1987,1969,5657,4814,4909,5460,6339,6414,4
572,495
2,3260,2958,3849,2863,10291,10388,8986,8444,9306
,8565,8797,9424,7185,6785,5213,5507,3627,3024,17
82,1279,
9040,8882,10286,10315,8905,8824,10506,10513,493
5,5425,5391,5242,2918,3732,3681,2965,9508,8674,8
998,9324 ,10757,10344,9275,8619,7180,6667,4821,4
794,5568,5010,6419,6724,5345,4848,4964,4915,5445
,4910,4535,5025,1
943,1899,3385,3289,6435,6203,5293,5674,9369,9096
,9761,8606,10402,10293,9483,8415,1994,1663,3654,
3872,27
75,3198,3490,2541,9318,9746,8855,8884,9027,9520,
8811,8664,4586,5235,6313,6704,3405,3299,1964,178
5,5776,4
719,6258,6421,3724,2921,1021,1935,10433,11272,93
29,8647,12448,13314,12808,12576,12816,12480,128
32,1235
8,10392,10317,8988,9381,5728,5432,4767,5294,3432
,2749,3614,2979,5458,4835,6300,6231,3371,3846,34
13,3521,
9793,9001,8906,9440,8913,9029,8908,9278,2804,338
2,2908,2547,5699,5653,7296,6341,2779,3696,3286,2
871,362
3,2970,3247,3722,6260,6314,5509,5012,1886,2001,2
922,3480,10404,11008,9494,9544,12332,12419,1236
9,12338,
9056,9002,9365,8798,9386,9104,9295,8914,8888,856
9,10508,10514,9616,8627,10758,10294,3469,2966,14
07,1779 ,5399,4559,5332,4939,6205,7186,5231,4477,
1990,1970,3684,3302,5768,5450,6675,6669,2550,384
3,1879,1022,948
5,9752,9009,9321,9984,8511,8813,9372,4593,5682,5
026,4917,6786,6425,4822,5057,5299,5278,6422,6670
,4968,55
14,4588,5346,5428,4727,6321,6437,2981,3414,1902,
1947,6532,7201,5670,5319,3386,3730,3635,3259,482
5,5241,5
701,4796,6235,6728,5892,4539,3536,2791,3406,2808
,6913,6342,5403,4837,3292,3629,2929,3195,6316,62
64,5474,
5658,5452,5301,4941,5415,2542,3427,3320,2750,103
23,10297,10761,10352,9004,8676,9537,8622,9764,93
30,1126
4,10375,12361,12303,12608,12421,2969,3672,2549,2
924,1759,1907,3463,2895,9491,9030,8859,9411,1031
8,10529 ,8680,9303,8431,8570,8651,8814,12340,123
11,12422,12672,6345,6480,5016,4478,3904,3492,304
0,3745,9602,881
9,10434,10325,8629,8572,9393,9800,1527,1996,1786
,1959,6206,6426,5681,4918,5521,4947,6287,7173,24
95,3655,
3484,3417,9010,9370,10516,10762,9486,8653,9735,8
688,7188,6247,5325,4826,2002,1913,3305,3752,8861
,9382,9
509,8871,10298,10408,9332,9271,12364,12425,1237
0,12344,10379,10339,9413,8916,9033,9497,8821,977

6,10326,
10300,8543,8659,1949,2017,2781,3845,5705,4594,6322,6438,1534,1788,3717,3388,3279,2875,3638,2982,10520,10329,9552,8630,9307,8929,10530,10769,4976,5352,4838,4541,5488,4567,6237,7202,8443,8654,8634,8633,10764,
10436,9858,8661,6788,6346,6736,6467,3682,3522,2930,2985,4731,5244,5792,5028,5676,4783,6536,6441,5306,5516,5708,5421,5896,4999,5230,4921,3011,3467,2795,3313,5331,5457,4596,5673,9741,8439,8875,9388,10381,11280,10341,10387,3167,2553,3429,2903,4942,5766,5291,4841,6914,6251,6324,7424,2972,3858,1910,1965,2782,2877,
3611,3261,3659,3411,2004,1901,4922,4828,6295,6353,3478,3306,3736,3434,6428,7171,5360,4542,6792,6238,5058,5522,12315,12385,12327,12547,9418,9034,9604,9319,3013,3662,3778,3287,5716,5032,6348,6442,8930,9336,10416,10382,12372,12426,12433,12549,5473,4571,6544,6752,1966,1775,2986,2932,2008,1531,2554,3375,7233,6496 ,6469,6677,9500,9091,9794,8862,9510,8975,9277,9041,3637,3852,1971,1950,2797,3418,3688,2993,12317,12331,12386,12803,9747,9385,9012,9768,8920,9120,8983,8559,10770,10561,9568,9093,4949,5406,4963,4733,3014,3504,
3729,2803,10271,10440,10330,11296,9425,8822,10785,10532,9513,8877,9036,9396,8825,8903,10562,10772,6299,
6354,5647,5326,6449,6691,5510,5003,5302,5763,5684,5429,3314,2907,1909,1991,10503,10389,10342,10345,9310 ,8445,8883,9493,4583,5904,6444,6253,3475,3641,3436,2988,9016,9367,10544,10536,9094,8878,9860,9414,4791,5537,5183,4842,3262,2878,3857,2959,4924,4849,5706,4950,5333,5422,7192,6328,9608,9325,8932,9539,12376,12428,12318,12434,3669,3630,3880,2919,2018,1727,2687,3528,9042,8567,9750,8636,13316,12359,12550,12553,3746 ,3383,2936,3420,4953,5464,6678,7204,5305,4600,4895,5451,6681,6259,4351,5060,3293,2527,3470,3316,7234,6311,6369,6470,5338,5005,6450,6916,1916,1855,1974,1995,2994,3780,3725,2798,6301,6800,5769,5655,5405,4815,6473,6254,3850,3674,3441,3017,9498,8662,9359,8675,12449,12864,12333,12388,5239,4573,6261,6356,5713,5011,5544,5476,9739,8607,11270,10403,8677,9097,10332,11273,2020,1977,2556,3661,6315,7182,4734,4844,6920,7208,
5040,5824,5427,5323,4965,5688,12928,13313,12339,12436,9394,8987,8665,9432,2909,3494,3905,3387,2805,3430 ,3018,3748,5524,4587,4795,5349,3291,2967,1787,1914,10287,10507,8826,8936,10625,10786,9808,9044,5447,4850,6474,7297,3642,3481,3874,3552,5279,5661,6370,6693,2923,3683,3307,2910,10564,10448,10626,10390,9152,9514,10393,10405,4954,5714,5513,5572,2005,1887,3968,3723,9057,8885,10346,10295,9323,9986,9542,8989,1023,1963,3493,2806,7187,6682,4574,5064,5356,4479,6531,6452,3197,2996,3407,3864,9417,9796,9763,9098,10568,11328,9444,8907,9333,9522,8999,8666,8828,9371,8886,8446,12334,12363,12554,12561,9742,9857,10776,10817,5308 ,5006,5897,4911,6360,6560,5675,5072,8909,9263,10788,11274,9507,8767,9105,9632,6415,6423,4966,5780,5729,5013,6302,6481,3644,3719,3760,3025,6694,6816,7236,6262,5433,5337,6476,6723,3433,2971,3670,3020,5702,5920,
4823,5246,5538,4589,5453,5347,8990,9003,8571,9400,12805,12392,12450,12341,6684,7216,5772,4969,3482,3359 ,1998,1783,10353,10394,9545,9383,10319,10509,8889,9756,6533,6317,5480,4797,3777,2809,3444,2925,12481,13320,12440,12365,8623,9334,8799,9420,7181,6265,5662,5027,2024,1980,3255,3523,5419,5894,5461,5569,6697,6343,4852,5430,4956,4595,6928,6323,4827,5744,5334,4919,10348,10818,8681,9516,10464,10406,9058,8915,3497,3860,3000,3734,5671,5018,5295,5770,2543,3310,1903,1973,3692,3667,3389,3477,10759,10792,8678,9765,9373,9426,9100,9985,3873,2751,3419,3686,6372,6482,4970,5528,5517,5014,6456,7680,3615,3784,2983,3733,6848,7298,5732,5350,3026,3673,2931,2810,6534,6318,4598,5891,6698,6725,5029,5462,9753,8910,9005,9556,10435,10510,8668,9048,3294,2551,3506,2973,7190,6537,5434,5778,6427,6266,6592,6497,3442,3317,2003,1789,11281,10881,9309,9603,12452,13056,14336,14337,9031,9521,9487,9338,12556,12562,12806,12342,5683,5307,5584,4839,5454,4856,6705,7240,11276,10763,8917,8890,9664,9106,10515,10820,2926,3526,2783,3847,5340,5677,4977,5243,9441,8944,9060,9011,9541,9006,8631,9121,1997,2032,3726,3908,6347,6207,4590,5475,12371,12345,12809,12400,10531,
10299,9389,9770,5368,4798,6484,6538,7193,7425,5017,5720,8682,9331,10409,10800,9872,8815,10354,10517,9824,9528,8863,9390,9554,8931,10396,10327,4597,4972,6671,6726,5511,4943,5952,5540,5088,5793,6700,6325,1978,
1917,3491,3685,6439,7203,6429,6376,2010,1519,352

9,3421,9795,9749,11392,10437,13312,12423,12366,12577,45
43,5703,5532,5465,6268,6349,5353,5800,3747,3303,3041,3639,6326,6787,4829,5893,10356,10410,9605,9108,949
5,8655,9428,9035,3876,3500,2933,2987,7300,6706,5765,5436,5327,4923,5686,5030,3042,3448,3792,3704,10301,1
1282,9327,8573,9864,9546,10771,10765,12482,12373,12564,12810,12346,12456,12427,12387,3028,3737,2974,28
12,6430,6729,5730,5570,3318,2989,3676,3415,3853,3505,2019,2006,8689,9778,9122,9013,10882,10521,8918,915
3,6443,6498,7189,6355,3969,3631,3435,3690,4978,5033,6545,7248,6329,7205,5059,5515,1951,1911,3015,3315,48
43,5361,6540,6488,9395,9374,10518,10766,9064,9610,8684,9442,9524,8823,10417,10533,12374,12348,12568,123
77,10628,11297,9766,9415,8921,9337,9797,8892,3532,3498,2021,2009,5215,4601,5477,4951,6730,6789,5020,590
6,7426,6737,6679,6384,10331,10824,9988,8635,11009,10438,9499,8933,7194,6350,4830,4925,5659,5309,6239,64
71,10412,10360,9570,9754,9548,9397,9037,9511,2934,2879,3731,3390,5707,5459,6708,6944,12578,12817,12812,
12484,10441,10576,9112,8574,5526,5354,5784,5482,5061,5710,5826,5335,6546,6500,5034,4980,3859,2995,3753,
3479,4602,5423,5685,5900,2555,3309,3888,2937,10302,10522,9777,9014,9617,9043,10383,11269,6451,6445,6561 ,7304,4845,5466,6357,7210,11284,10343,9421,8922,9801,8690,10418,10534,12429,13328,12389,12435,9072,9448 ,8934,8637,3698,3032,3808,3538,3663,2799,1790,2026,9584,8663,10333,11298,12464,12430,12818,12609,10884,
10442,10832,10563,12319,12488,12378,13344,3750,2990,3906,3471,6712,7264,5736,5041,3508,3431,3044,3740,6
976,6732,5062,5552,8827,9340,9888,9124,9772,8879,10632,10537,5777,4851,7179,7681,3689,3862,3019,3525,63
30,6790,5362,4955,1975,2012,3321,3560,9402,9612,9804,9517,9992,9095,9326,9017,3781,2938,3646,3422,6548,7
235,6371,7040,12833,12580,12610,12820,9427,9553,8692,9769,9038,9862,9387,8937,11010,10347,10420,11520,1
2551,12437,12390,12393,9018,8924,10391,10449,1967,1915,2557,3854,3970,3697,2997,3021,6738,6562,5523,568
9,5484,5036,6446,6793,10524,11267,9456,8638,10888,10334,9154,9618,5310,4926,6915,6504,5905,5007,5717,56
78,9812,9128,10444,10538,9569,8667,10640,10848,6683,6255,5928,4967,7196,6475,4735,5576,5794,5431,4984,5
468,5341,4575,5518,5364,3445,3537,3756,3675,7312,6358,5042,5828,6453,7206,5773,4846,5898,5722,7428,6332,
11329,10592,10565,10773,9045,9502,9059,8829,3048,3738,2940,3322,3486,3865,3438,3512,2025,2022,3916,2998 ,6593,7217,5489,5065,6361,6552,6753,6740,4604,5709,6695,6794,10395,10450,9743,9422,10545,10787,9606,909
9,9398,9859,9780,9525,12592,12584,13318,12451,3199,3779,3554,3875,6373,6303,4957,5542,8679,10000,10540,
10349,12380,13321,12335,12555,8887,9633,9279,8938,12673,12834,12612,12496,6564,6454,5953,5435,3645,291
1,1981,1918,9020,8945,9802,9046,9429,9518,11288,10424,2033,1999,3499,2807,7237,6685,4853,5478,7432,6917,
5066,5796,3912,3762,3749,3443,12674,12438,12441,12453,12394,12343,12616,13376,9049,9560,10774,11300,94
01,8696,8991,9547,6754,6801,6477,7209,3851,3056,3671,3530,10777,10355,8447,9156,12824,12865,12836,13322 ,11330,10407,10465,10566,9434,9101,10546,11012,10397,10896,9865,9751,9501,8911,10569,10350,5339,5015,62
63,7242,5690,5529,5922,5600,4971,5731,5355,4958,3324,2558,3483,3700,9335,8669,10357,10452,9809,9107,964
0,9572,6744,6483,6016,5771,3027,3540,3001,3976,10411,11278,8830,8940,11016,11304,9136,9920,7328,6362,55
41,4854,3877,3437,3786,2811,6512,6796,5245,5044,5455,5912,7175,6374,9523,9419,9061,9784,9620,8683,8891,9
445,5692,5767,5808,5073,2028,1533,3920,3022,12401,12442,12367,12557,9543,8946,10570,11393,3501,3691,376
1,3866,6535,6457,5481,5019,5718,5068,6594,6686,5530,5407,7682,6478,3263,3450,3677,3568,5825,4857,5492,49
73,7220,6377,6699,6918,3878,3739,3002,3507,6319,6267,7299,6802,5303,5571,6756,6485,14338,14340,12396,12
866,9375,9757,10466,10789,3782,2927,3029,3553,5545,5908,5048,5782,9050,9810,9609,9668,12512,12454,12807 ,12840,6921,6364,4591,5358,2011,1982,3754,3030,6458,7249,5740,5715,6568,7212,5437,5525,12483,12558,1332
9,12929,11283,10778,8670,9160,9452,8575,10627,10548,13324,12811,12563,12868,6539,6817,5921,4799,3972,29
75,3881,3687,9404,9102,9993,9007,10456,10656,9771,9168,10511,10519,9062,9876,9825,9109,10398,10577,3495 ,3794,2034,1979,5467,5734,5663,5832,10790,10912,11332,10358,9529,9433,10572,10819,9798,10016,8919,9342, 9634,8685,9549,9443,3391,3727,3868,3809,6727,6499,5031,5781,10780,11312,9868,9065,10629,10413,9576,8893 ,5074,5721,7440,7238,4979,4858,5342,4599,12579,12347,14344,14352,11277,10361,9758,9123,3527,3323,3043,3
788,6431,6327,5554,5021,12457,12848,12402,12565,9515,9990,9557,9665,3449,3936,2813,3004,5490,5365,6378,
7195,10793,10439,8948,9526,9052,8691,11024,10419,8923,9840,9430,9015,12444,12375,13440,12485,4974,5574,
4831,5895,3544,3909,2935,3485,9767,9114,9391,9866,12404,12458,12349,13330,6269,6701,7360,6804,6760,6486 ,5774,5956,6460,7301,6385,6922,6707,7218,5539,5733,3033,3768,3045,3678,6489,6596,5577,5469,6541,6547,725
6,6351,3861,3510,2023,2013,10468,10578,9066,9624,9613,9110,10552,11776,5795,5351,5089,5687,5924,5548,76
84,6818,12819,12813,12930,12569,10944,11394,9828,9446,4981,5035,5090,5496,3446,3693,2036,2007,10630,104
14,8694,9987,10794,10821,9125,9558,6702,6929,7244,6576,3896,3735,3295,3764,5840,5752,7183,6501,6331,730
6,5076,5785,12566,12814,12465,12581,11286,10633,9530,9874,5022,4860,6380,6808,5366,5037,5724,5463,5901,
5553,7456,6768,3984,3034,3531,3699,10523,10362,10688,10593,9779,9403,9680,8935,6731,6924,7224,7266,3793 ,2991,3907,3556,6017,5679,6849,6270,3882,3502,2939,3889,9550,8952,10801,11336,9436,9773,9073,9339,5483,5
738,6386,7207,5063,5363,6709,6542,12676,13345,14368,14339,10443,10303,8686,9571,5580,5546,6490,6600,304
6,3643,3326,2814,4982,4927,5779,5438,3513,3757,3812,3694,12379,12872,13057,12486,9464,8894,10580,10634,
11289,11521,9113,9816,8693,9068,10767,10822,9607,9039,10048,9636,9184,9889,10796,10421,12460,12408,124
89,12624,10535,11299,10525,10472,5907,5043,6502,6549,6447,6713,7688,6388,8639,9799,9628,9561,10364,1044
5,9449,9896,5801,5527,7302,7241,6739,7427,4603,5357,2030,2014,3785,2559,5936,4985,6333,6710,10422,10883,
8925,9989,11396,10802,9861,9532,3533,3452,3741,3914,5746,5080,5856,5586,9423,9019,9782,9126,12350,12570 ,12431,13317,6820,7313,7198,7252,5711,4847,6505,6850,10526,10825,9826,9666,13332,12391,12466,12582,6733 ,7488,6359,6930,5798,5038,5954,5519,10539,10594,11285,10451,9074,9129,10641,11344,6791,6492,5556,5479,2
040,1535,4000,3539,6563,6550,5092,5788,5737,5910,5067,5573,6608,6824,5369,5608,5829,4986,5694,5470,1042
5,11301,9155,9611,8939,9457,10636,10584,3036,3705,3800,3855,6945,7213,6506,7308,3447,3892,3049,2999,460
5,5902,6734,6553,12381,13346,12932,12490,12880,12611,12680,12585,3702,3974,3755,3439,3050,3516,3884,354
2,7430,6714,6018,5745,3921,3319,3742,2941,9311,8697,9573,9047,10826,10885,9116,10002,7265,6932,7696,725
0,3971,3509,3796,3763,5045,5069,6741,7219,6716,7330,5493,5585,11522,10833,10775,10480,14341,14400,13058 ,12395,2027,2029,3023,3910,6363,6455,6852,6742,2942,3863,2035,2037,7433,6745,5804,5723,11290,10446,8926,
9021,9755,9405,10335,10567,12468,13568,12439,12497,9803,9555,10804,11040,9622,9450,9880,9578,9157,9806,
9922,9431,6795,6565,5096,5786,6936,6946,4988,5370,10642,10596,9130,9076,12572,13315,12936,12382,8698,95
19,9781,9996,10547,10541,10657,11400,8941,9562,10453,11306,12492,12586,12688,12896,6755,7191,5534,5913,
6746,7316,6554,6375,10808,11360,9832,9137,11072,10828,9158,9648,5486,5560,6832,6797,5964,5046,5247,5827 ,9873,8947,11275,11777,10426,10886,9458,9051,13377,12640,12613,12821,10644,11331,10467,11136,5602,5923,
5693,4959,7272,6392,7214,6513,3545,3701,3558,3810,5547,4855,6334,6508,5960,5810,7712,6798,7239,6803,579
7,5491,12443,12498,12593,12835,10834,10658,9619,9785,3890,3423,3751,3057,3514,3922,3003,3787,3534,3978,
3937,3052,7305,6479,6624,6459,9580,9132,10542,10889,9406,9022,11011,10600,12588,12397,13336,12472,1000
1,9103,9813,9774,5899,5104,6365,6514,7429,6757,5719,5578,12822,13348,12825,12403,10779,10351,10024,9063 ,11292,10571,8831,9672,13378,12455,12513,12614,3706,3869,3766,3977,7552,6566,5372,4606,1791,2038,3647,3
555,3824,3453,3783,3879,9890,9527,9080,9564,9437,8671,9614,9460,6569,6595,5531,5748,3541,3058,4032,3503,
7221,6758,6687,7442,6379,6556,6487,6516,5075,5588,7329,6919,5049,6024,5925,5485,12594,13060,12445,12944 ,
11408,10454,9138,9924,10549,11302,9869,8942,9994,9818,11524,10428,12617,12398,14345,14342,12405,12500,
12459,13326,6461,7683,5834,4859,6366,7243,5968,5070,10689,11313,9585,9161,10457,10648,10849,10836,6570,
6597,5549,5739,6381,7268,5809,5914,8700,9805,10791,10890,13064,13352,12618,13441,3005,3913,3031,3758,53
11,5498,6703,7314,10469,10399,9053,9638,10660,10

550,10049,9531,5725,5616,5926,5787,7436,6977,5050,5555, 11333,10781,8949,9574,11528,11013,9162,9892,3006,3562,3924,3816,2041,1919,3769,3986,5830,4975,6948,6856 ,7226,6978,5077,5601,6805,7197,5802,5078,3708,3548,3451,3940,10850,10897,10573,11305,9435,9111,10359,11338,9786,9625,10018,9696,9067,9827,9451,9054,12514,12837,13331,12826,10840,10579,10112,9867,6952,6923,7361,6761,6748,7685,6577,6864,12675,12596,12504,12704,12559,12567,14353,14346,11424,10458,9637,8950,12446,12625,12838,12960,3867,3789,3564,3035,6960,7245,6020,5023,7320,6980,5929,5735,3980,3511,3060, 3891,10608,10892,9341,9140,9551,10008,11271,10470,6491, 7041,7280,6387,3797,3047,3886,3325,5543,5842,7441,6806, 5439,5775,7744,6598,9788,9863,9904,9169,13380,12406,12620,12867,12828,13360,12677,12461,13325,12409,12841,12487,6462,6819,5916,5857,3695,3973,3546,3790,10631,10553,9577,9115,9814,9164,10690,10782,9626,9503 ,11778,10574,13072,12467,12516,12626,9921,8953,9588,9069,11316,10473,10795,11014,5575,5371,5091,5836,3561,3928,3765,3064,7254,6762,5497,5984,4861,5052, 7225,7042,10415,10363,11395,10898,9399,9667,10852,10581 ,6925,7458,5592,5957,7364,6520,4983,5533,9641,10004,9144,9878,11017,10460,8687,9454,4001,3885,3915,3679, 5081,5816,6572,7690,5093,5726,5909,5558,6809,6880,6711,7251,3517,3795,2815,3952,7336,7222,5494,5741,10554,11345,9836,9811,10664,11308,9533,9621,6984,6769,6382,7303,6503,6601,6543,6931,5944,5783,6735, 6822,3772,3572,3037,3454,5343,5812,6578,6821,7434,7686, 6032,5082,10635,10913,10017,8895,14354,14464,12600,13824,9563,9830,9759,9928,12992,13442,14348,14369,3802,3870,2042,2039,5579,5747,5841,5039,10823,10595,9127, 9877,9170,9817,11536,11334,12678,12462,12842,12869,9075,8954,9438,8695,6493,7444,5955,5604,7246,6389,7332,6602,13334,12681,12571,12410,10527,10423,9650,9117,12736,12641,12849,13384,12491,12351,12628,12682, 3883,3547,3992,3911,3938,3515,3051,3570,9586,9461,10474,11291,13337,13569,12815,12870,9070,9670, 8927,9991,12844,12469,12583,13347,5930,5550,6810,7257,6764,7697,4987,5937,10365,10797,11456,10900,10856,10582, 9870,10052,10556,11397,10481,11018,10803,11314, 9635,9829,12573,12520,14401,14356,10585,10692,9673,9565 ,5094,5691,7307,7457,5374,4862,5561,5805,10637,10643,11352,10447,9891,9447,9185,9783,3811,3743,3898,3038,6507,6271,5860,5742,10020,9644,11780,10914,9077,9131,9186,9592,3053,3985,3770,3893,7211,6335,7269,6926,10798,11025,11340,10672,12412,12493,12470,12931,6551,6580,5833,4607,6770,7362,5581,5500,9936, 9848,11279,10597,13444,12850,14592,14370,10427,11402,9172,9881,9118,8956,10476,10904,6715,6609,5789,5962,6825,6390,6851,7490,9462,9133,9820,9559,9997,9649,11552,10864,6048,5587,5084,5753,3543,3703,3813,4004, 5848,5903,6494,7228,6743,6812,7692,6934,5495,5940,7309, 7464,6604,7267,5097,5047,5750,6022,7344,6393,3535,3798,3917,3569,12574,12873,12587,12642,10827,11020,11320,11362,13333,12499,12689,13392,10113,9775,10945,10366,6826,7808,5803,5487,2044,2043,3007,3944,9579,9834,10482,11303,9159,9459,10805,10638,6717,7315, 6555,6947,5098,5564,7260,6933,12473,13349,12684,12632,9676,9642,10586,10696,12874,12933,13570,12881,9078,9023, 9875,9534,7448,6853,6509,6584,5932,5590,5969,5367,12823,12528,13338,12494,10003,9139,10598,10645,10543, 10809,11784,10484,9897,9623,11398,11337,6772,6833,5790,4989,3311,3988,3818,3925,10835,11523,8699,9453,10032,9081,10429,10806,12383,12615,12852,13088,9842,9176,9952,9682,6518,7368,6019,5557,6567,7700,5844,5811,14360,14372,12690,12644,10916,11409,11294,11348,6610,6937,5071,5958,3557,3759,3804,3894,9807,8943,10601,10946,10829,11584,10455,11026,4990,5911,7274,6394,6515,7318,5593,5749,14343,14465,12595,12589,9894, 9134,10050,9615,10887,10588,9652,9575,12705,13448,12501,13354,10659,10646,9188,9884,9833,10006, 9163,9669,10704,10920,9465,9704,9925,9082,9790,9566,3059,4008,3832,3918,6625,6718,7492,6557,12856,13408,13120, 12876,11041,11309,10602,11404,3710,3061,4033,3801,7253,6747,6510,7689,5606,5858,7431,7199,6612, 7714,5938,5471,8701,9998,10830,10649,13323,13825,12474,12934,6799,7044,6949,6759,3975,3576,3897,3930,11526,10810,10114,9841,12692,13379,12515,13184,7310,6828,5799,5105,2031,1983,3814,3559,11361,11028,11792,11346,9141,9165,10837,11315,7553,6854,5562,5970,7331,657

3,5051,5835,10812,11426,9589,9681,12882,12706,12590,129 37,6938,6396,7258,6517,6749,7376,6992,6834,5582,6026,6857,6776,5985,5100,5754,5917,10459,10551,10948,10 838,14402,14848,13059,12648,5814,6025,7460,6626,6950,7276,5695,5603,7227,6571,5872,5501,7321,7048,7713, 6558,12827,12399,13340,12619,11529,10841,9900,9819,4002,3767,3825,2943,5831,5927,7435,6367,7270,7698,55 89,5106,3487,3054,3926,3939,10891,10661,9192,9882,11032,11042,9084,9466,13456,12502,14347,14376,10851,1 1287,9630,10009,3987,3709,3550,4034,6807,6836,6979,7472,10842,11412,10650,10471,12597,13350,13572,1247 6,6080,5551,6763,6616,3900,3982,2046,2047,9582,9656,10928,10893,10060,9142,9343,9923,12737,13361,12505, 12696,9698,10019,9789,9055,11368,10488,11310,10609,12897,12884,12839,12938,9643,8951,10430,10604,10056 ,9906,11808,10894,11335,10899,9893,9587,12517,12447,12708,12598,5053,5961,7281,6599,3771,3820,3563,3945 ,13381,12829,14404,14466,11401,10575,10720,10555,6940,7333,7745,6953,6858,7392,6865,6981,9995,9200,1046 1,10610,11525,10853,9815,9674,13576,13061,12898,12945,11648,10662,9468,8702,6860,7230,5079,5806,7446,74 96,5054,5610,12621,13353,12407,13386,10665,10691,9627,9844,7008,6954,7317,6750,5972,5864,7338,7056,1288 8,12627,13472,12506,11317,10854,10783,11538,10475,10652,10583,10612,9171,9684,11425,11015,5817,6034,72 47,6866,6840,6521,5756,5596,5499,5988,7568,6579,5915,5837,5612,5083,3062,3518,3791,3979,7437,7704,6028,5 559,12656,12940,13319,12518,9145,10120,10021,9581,6961,7273,7936,6463,5108,5939,6765,7324,3065,4016,392 9,3942,3817,3565,3826,3989,12679,12601,12738,12830,10557,11779,9930,8955,10462,11339,10064,9166,13826,1 2622,14355,14349,5845,5095,6956,6628,7489,6574,7716,7282,14384,14350,13364,12521,10666,10693,9645,9835, 3871,3707,4040,3923,7443,6982,6811,7363,3803,3549,3066,3948,5934,5373,6632,7255,10477,11364,9905,10010, 12843,13062,12463,12411,3773,3039,3981,3887,6383,6522,6603,6766,7554,6771,5743,6021,6581,6524,5594,5838 ,9407,9594,10799,11410,9821,9712,10022,9883,11532,11073,9146,9651,13443,12946,14408,14593,12900,12629,1 3065,12508,12602,13393,12712,13356,7345,7752,6962,7322,5609,5976,5813,5112,9926,9071,11044,10952,11322, 11074,9173,9697,10901,11293,9898,9174,12683,12961,12871,12643,11048,11019,11457,10857,10844,11781,1067 3,10960,11056,11341,10116,9119,11416,11076,10025,9831,6049,5933,7438,6605,5963,5727,7687,6640,10587,111 37,11376,10483,9639,9938,11537,10902,6813,7334,5565,5843,7461,6823,4863,6000,9535,9871,11840,10694,1055 8,10915,10012,9953,13584,13382,12575,12471,12522,13339,14357,14468,5820,5620,7284,7223,3573,4003,4036,3 932,5085,5502,5850,5918,7365,6868,6985,7449,6773,7728,6495,6611,3774,3996,3828,3566,9671,9467,9187,9932, 12413,12845,13504,12948,7504,6582,7259,6881,6395,6606,6586,6585,12904,12630,14371,14594,11350,10858,95 93,10080,12604,13445,12529,13066,8957,9148,11321,11138,5931,5595,7810,6613,7693,6391,6827,7340,11021,11 554,9688,10053,12851,13362,12633,12740,11460,10616,9079,9629,12685,12691,13400,12495,3068,3815,3953,38 99,6040,5959,5986,5563,3941,3993,3805,3578,5099,5618,7370,6986,14362,14849,13828,12962,12846,13073,1338 8,12720,7556,7271,6882,7288,4006,3519,3055,4048,5859,5791,7452,7043,7746,6814,5946,5086,9177,9912,10668, 11786,9189,9822,10005,9654,5101,6033,7462,6927,7229,6993,5818,5941,13327,12645,12475,13450,10905,10976, 10807,11347,12524,12952,13600,12912,11432,11318,9590,9837,11080,10865,10478,11399,10599,10697,10639,11 027,7699,7337,5591,5751,3895,3946,3571,3990,10040,9879,10831,10918,12875,13068,13368,13410,6964,7720,68 72,7072,6935,6511,5861,6052,9439,9908,10674,10917,11530,11782,10128,9178,7520,7045,5583,5846,7377,6774, 5965,5617,9675,9843,9937,9135,10589,11540,10051,9700,11342,10485,11428,10698,14416,14373,12993,12414,7 465,6829,6988,7348,6777,6855,5055,5992,4009,3919,3819,3577,5359,6036,7262,6397,6835,7445,6968,7319,5866, 5973,7046,6830,10026,9646,10906,11353,12530,13351,14361,14358,10860,11793,9083,10033,9190,9787,11403,1 1553,12853,12686,12634,12744,9470,8958,9657,9901,7812,7366,5605,5807,7560,7277,6884,7491,14472,14596,12 646,12693,12591,12857,13832,12532,10603,10367,9956,9838,13446,13385,12883,13571,3960,3806,4037,3994,35 74,3954,3931,3821,5852,5942,6994,6519,7702,6588,5107,6056,12477,12854,12964,13457,11307,10431,11365,11022,10647,10676,9929,8703,13342,13396,12649,12994,7450,6614,7311,6627,7691,6559,5880,5966,10866,11458,9677,9596,12877,13632,12503,13074,10811,10705,9885,10058,10921,10486,10947,11586,4005,3901,4024,3063,5758,5109,6629,7049,12935,12636,14600,14374,10144,9683,9180,9849,12707,12694,14850,14432,9944,9999,10590,11324,10839,10908,11788,11030,9591,10036,11405,11560,6081,5849,7346,6939,6617,7384,6778,6888,6023,5624,7760,6996,5945,5978,7104,7466,10700,11363,9193,9143,9846,10118,11440,10489,7009,6837,5862,5607,3799,4041 ,3551,4010,10922,11904,9899,9583,12752,12968,14403,14377,7275,7938,7494,6941,7369,7748,7715,7050,10813,11411,10651,11043,13089,13357,12650,13452,6050,5815,7396,6859,7285,7474,5873,4991,9194,9660,11356,11029,11544,10949,10605,10680,3829,3933,3956,4064,6951,6618,6780,7323,2015,2045,3902,3580,6838,6398,5535,5102,14480,14364,12878,12697,10028,9686,10065,9463,10868,10929,9886,9085,13574,12858,13409,13076,7694,7809,5974,5987,6861,7215,7459,6719,10614,11464,10115,9653,10663,11796,9940,9907,13840,13394,12885,13363,10706,11033,9167,10054,12860,13474,12507,12599,9086,10007,11370,10490,10611,11414,9689,9845,12996,12886 ,13577,12889,7057,7584,6942,6955,6523,7352,6035,5757,12939,12709,13080,13090,14405,14378,12899,13335,10721,10814,11588,10653,12890,13460,12698,12519,7497,7335,5598,6082,6841,7708,5948,6030,11349,10843,10606,11785,9702,9954,11527,11295,10708,11810,10034,9567,10895,11140,11045,10855,12976,12941,14852,14385,11406,10924,9895,9201,6575,7286,6751,7372,4020,3822,3067,3943,13416,12536,13358,12657,11649,10950,9658,10066,6633,7468,5819,5868,7010,6867,5611,5993,14410,14608,12478,12652,11427,10669,9147,9931,4035,4017,3830,3327,6630,7717,7325,7378,11034,10492,11354,10613,10845,11472,11088,10930,13856,12942,13383,12947,9678,10122,10953,10872,10081,9196,9850,10013,13449,12623,12768,12603,9910,10121,11556,10722,11046,11372,9791,9699,7052,7937,7705,6862,5110,5566,6957,7508,11323,10667,9968,9597,11417,11144,11809,10654,5839,6027,6620,7000,3991,3947,4042,3711,7261,7555,6983,7473,7439,7290,6869,6842,7616,7058,5113,6064,7393,6896,7012,6963,12509,12658,13573,12901,9927,10023,11531,10463,11366,11794,9685,9202,13696,12710,14496,15362,7493,6958,6583,7073,5977,5990,7341,7722,12713,12739,14856,14624,10903,10932,11075,11568,5865,5613,6634,7283,5874,6037,5919,5755,13365,12902,12831,13586,10176,9647,10859,10712,12523,12700,12631,12660,9149,10057,11377,10695,7824,6767,6088,5971,7776,7480,5851,5597,14864,14528,13473,13063,11036,11429,11841,11049,12605,13827,12510,13387,12714,12741,12525,13412,6815,7342,7506,6883,4012,3833,3069,3983,10954,11488,10961,11077,10956,11326,9175,9902,11542,11592,9150,9706,12847,13458,14880,14406,5114,5996,7747,7701,5821,5087,7557,7060,11104,11050,11413,10846,10068,9960,11434,11152,3934,4049,3455,3827,7447,6607,7380,6987,13580,13121,13092,13000,9913,10130,11343,10962,10936,10617,9852,9692,13370,13122,12949,13341,14380,14467,14417,14386,9595,10084,11664,10675,10011,9933,9708,9179,13096,13067,13505,12905,11533,11800,10124,9655,11057,11369,12032,10559,9204,10035,10861,11420,12892,13829,12721,13008,4038,4018,3927,3070,7279,6525,7816,7498,13104,13389,14409,14351,13464,13124,12635,13185,3950,3995,3807,3955,6641,7730,7074,6965,9941,9191,11052,10724,11585,10670,11812,11378,13424,12531,13585,12950,11539,11078,10907,11459,6870,7105,7347,7326,6029,5935,7016,7562,13888,12742,12606,12963,10030,9469,10728,11351,6636,7394,7476,6775,5621,6051,6084,5980,14656,14469,13398,12906,10479,10618,10699,10862,11650,10867,9839,10117,10677,10620,9690,9934,5822,6044,7718,7367,6873,7289,7749,6844,5876,5614,7940,6587,5116,5863,6001,5947,13369,13186,13069,13602,11441,11848,11058,11418,7451,6885,5989,6041,7522,7706,7500,7349,6989,7463,7064,6526,3575,4044,3834 ,4007,13508,12664,12716,13834,14388,14359,12953,13024,7729,6966,7569,6995,7373,6874,7753,6642,9705,10072,9909,9208,12855,13395,14470,14720,13480,13366,14412,14473,10145,10029,11534,10701,4050,3961,3997,4065,5853,5626,7024,7400,10059,9823,11783,10736,13128,12913,12526,13447,6886,6589,7536,6615,3582,38

36,3958 ,4013,10909,11430,9661,9939,11557,10919,
8959,10096,12647,12745,12687,13075,9916,9716,11
380,11319,14418,
14392,12879,12966,12722,12965,13578,13830,14363
,14433,12637,13588,9181,9598,9946,10014,11461,10
964,110
81,11545,13390,12533,13476,12746,6054,5567,5103,
6096,6779,7292,7840,7076,10869,11824,10591,1070
7,12954,
13401,12908,13841,11600,10678,11355,10977,10491
,10702,10682,10681,10027,9691,11906,10709,11789,
10487,1
0923,11436,13451,13601,12651,12415,10136,10055,
10082,9659,7724,6831,5943,5994,7354,7564,7756,74
69,9195,
9714,11466,11082,11652,11367,10978,11384,5619,6
038,7944,7047,7278,6969,6057,5967,13355,12479,13
413,130
70,12695,12724,14375,14595,9955,9887,11548,1113
9,12914,13506,14420,14474,7379,7505,5867,5625,66
44,7721,
6990,7814,7339,6889,6008,5854,4052,3949,4014,382
3,6970,6876,6085,6042,7408,6590,7106,7570,12859,
12753,1
4481,14597,11842,10910,10042,9182,7764,7080,752
1,6619,5622,6002,6997,7454,12969,12534,12995,136
34,9197,
10129,11558,11023,11325,11089,9914,10037,14365,
14379,14434,14851,7011,6781,7695,7374,5979,5869,
7558,70
51,12638,13372,12887,12956,11795,11433,9687,984
7,4056,3579,4019,3998,7350,7811,7732,7477,6631,7
952,6053 ,5949,6839,7585,7231,6890,13836,13078,1
4424,14476,13453,13608,12748,13411,3957,4039,40
66,3775,6072,5111 ,6972,6897,7754,6998,7381,7470,
5847,6089,5599,6058,13488,12537,12970,13952,110
60,11816,10968,11168,1103
1,10607,9957,10148,12861,13459,12699,13091,1161
6,11141,9679,9942,13404,13077,13592,12997,11473,
10870,1
0061,9713,11561,10925,11084,11444,12653,12728,1
2916,12977,10873,10951,9151,10088,14366,14482,1
2662,135 12,9455, 10132,11358,10493,
10931,11541,11064,11415,9962,10069,11142,10926,
11908,11462,9701,9903,11656, 11
373,10980,11587,7001,7512,7353,6648,6943,7499,63
99,7108,15364,14407,12711,13844,9948,10038,1109
0,10615,
12754,13081,14598,14601,11798,10684,9203,10152,
11546,10710,11407,10723,14497,14912,13418,12538
,5877,59
81,7386,7053,6004,6112,7817,7703,7453,6863,7287,
6621,7761,7059,7592,7524,3964,3903,4022,4043,678
2,6892,5
950,5628,12659,13462,14381,14436,11787,10655,99
76,10062,12769,12862,13636,12701,13397,12891,12
654,1383
3,9854,9205,10725,11145,13575,13343,12756,13858,
7088,7872,7475,7371,7013,7736,7572,6635,12943,13
188,130
93,12903,10177,9945,11442,11035,13454,12972,136
97,12998,10713,11480,10874,10984,6843,7397,6068,
5870,40
68,4025,3835,3962,4053,3935,3071,4011,7495,6898,
5115,5991,14976,15361,13475,12717,10119,9720,11
856,1109
2,14387,14484,13082,12540,10041,10074,11200,115
62,7327,7709,7002,7762,7561,7620,6622,7112,13402
,12661,1
2893,13520,13136,12978,14382,14411,7404,6527,60
83,6065,7356,7054,7945,6959,11105,10933,9958,970
3,13001,
12920,14602,14609,11371,12034,11590,11037,11465
,11844,11811,11146,10146,9911,11492,10955,11381,
11570,99
69,9087,7723,7120,5878,5375,7014,7828,7777,7061,
13604,12770,13094,13420,11047,10714,10876,11419
,6039,59
95,7481,7385,6090,5759,7750,7968,14853,14440,133
71,12715,10934,10494,9631,9198,6871,7294,7586,66
37,7501 ,7395,6060,5881,13465,13192,13857,12702,
11790,11905,10070,10083,10957,11311,11555,10815
,14498,14389,13
579,12511,11153,11680,11038,11051,10619,11448,1
0131,9853,4046,3831,4072,4028,7820,7017,5117,603
1,7528,6
845,7710,7075,7467,7942,7509,7617,13414,13842,12
951,12980,11593,11431,9694,10178,10937,11804,10
044,101
26,13123,13616,12907,12760,10671,11382,10847,11
468,14529,15368,13425,12743,6900,7478,7004,6643,
6875,77
92,7382,6967,10729,11564,9915,9964,11106,10963,9
707,10089,14488,14413,13084,13477,13889,13097,1
3002,13
536,7719,7066,7343,7818,5982,6097,7018,7576,1300
9,13125,13004,13374,14500,15104,13590,13640,107
26,1181
3,11421,11474,13152,13098,13461,12894,7565,7062,
5503,5875,6086,6066,7780,7398,11148,12033,11801,
10958,9
206,9662,11053,11604,13482,13200,13391,13010,99
35,10123,10716,11096,3951,4021,4051,3837,6646,79
39,5975,
5118,12984,12665,14604,14610,11357,11651,11079,
11569,13712,12723,14854,14390,11535,11386,10965
,10938,1
3581,13848,13105,13417,11712,11154,9209,10160,7
077,7510,5998,6043,7482,7826,7731,7355,7632,6887
,7502,69
04,4045,4080,4026,3965,11489,10992,11108,11059,1
1589,11054,10679,11169,7388,7725,7025,7291,6638,
7523,74
16,6846,14080,12607,12909,13468,10073,10086,114
37,11818,9961,9709,10730,11379,14419,14393,1485
7,14448,

9970,10133,10015,9851,11920,10863,10184,10067,7065,7768,6645,7020,5855,6003,7559,6991,13100,12772,13633,12718,11872,11576,9947,9693,8000,7588,7136,7841,5623,6092,5882,6055,10911,11438,11602,10979,13860,13426,15360,14471,9210,10092,11843,11797,9917,9183,11653,11156,6591,7751,7580,7513,6098,6009,7401,7848,13587,13126,12955,13507,14414,14625,12776,13399,12527,12666,12747,12910,11543,10703,11476,11083,13698,12915,14530,14421,12725,12668,13489,13896,13106,13466,14612,14858,11375,10621,11912,11594,6045,6113,6877,7941,5630,5884,7813,7484,13582,12749,13831,12784,10737,11826,11170,11061,12957,13478,13605,12967,14394 ,14504,13428,13367,7375,6971,7734,7078,4058,3567,4067,4054,10966,11201,11443,11422,10125,10031,11112,11658,10732,11490,11572,10871,14475,14435,13509,13012,9717,10147,10180,10076,9918,10140,11814,11463,7778 ,7618,7026,7081,3999,3959,4069,4057,13129,13593,12917,13872,14422,14396,12639,12755,7107,7563,6891,7409 ,7263,6649,7525,6999,10969,11385,11845,10940,14616,14425,13648,12726,13403,13025,14626,14865,9972,9710,12036,10683,9212,9959,10097,10043,12539,12750,12730,12729,11547,10981,10085,10137,11618,11802,11596,11445,11085,11559,11160,10622,14860,14532,13954,12757,7068,7954,6006,6061,6878,6973,7707,7357,13837,12535,12971,13484,14477,15376,14437,14483,7755,7507,6100,5997,7574,7402,7832,7530,11825,11062,11665,11091,13514,13130,13700,13415,7109,7758,7874,7383,6062,5871,7082,7028,11469,10970,11849,10738,13026,13432,14512,14478,9949,9722,11120,11496,13596,13187,13890,12958,10982,10685,11632,10711,13606,13071,13373,13137 ,6104,5627,6650,7471,7733,7948,6067,6046,10150,9663,9199,10192,10875,11388,11936,11172,6893,7514,7784,7089,7110,7600,7825,6899,11820,10927,10039,10090,13843,13481,13108,13864,13016,13216,13079,12655,14866,14657,13664,13189,11450,11660,11852,11565,14367,14536,14426,15392,13521,12918,14881,14628,9715,10134,12040,11143,3838,4074,4023,4060,7410,7003,6005,6087,11374,11065,10153,10063,13609,12973,13132,13492,7571,7737,7532,7084,7358,6974,7953,7055,11475,11601,9963,9721,10740,11817,11086,11910,12921,12999,14658,14868,14599,14485,14438,14441,11435,10985,10104,9950,13406,12541,12979,13589,13112,13463,14640,14632,131 90,12974,13956,13510,11066,10972,10181,10138,11504,10686, 11202,11666,13704,13421,13028,13635,11860, 11176,11617,10715,4015,3963,4073,4070,7765,7726,7976,7015,13138,12663,13846,12732,9718,10098,11093,11550,11107,10877,11791,11470,10075,9965,11654,11147,13594,12758,13455,12771,11446,11907,11828,11573,10727,12048,10149,10045,10935,11681,11327,10986,6114,5823,6783,7624,7842,7479,7032,7516,13835,12703,15366,14499,12773,13193,14428,15369,7389,6623,7566,7412,6012,5951,6070,6091,10168,9207,11068,10993,13490,13083,12761,13528,7090,7876,7821,6894,7946,7770,7537,7113,6116,6073,6652,7757,7005,7590,8001,7483,14383,14603,12922,13032,11850,11094,11477,11566,6901,7526,7114,7844,7387,7063,5883,6010,14721,14882,13904,13140,14660,14544,14722,14486,7738,7577,7970,7648,7019,7779,7403,7006,9943,10185,9695,10154,13248,13610,14489,14501,13153,12981,14442,14391,11097,11608,11449,10744,4029,3966,4081,4047,6101,5983,8064,7819,13419,14082,13638,13085,13513,13892,13859,13194,5119,6059,7589,6902,4076,3581,4059,4030,14664,15424,13540,13003,11039,11595,10495,11204,13429,13618,13095,12762,9973,10077,11482,11149,12924,13467,12982,12542,10100,10208,11913,11799,13838,13953,14872,14913,11549,10959,11383,10717,13005,13359,14884,15370,13603,12863,13201,13728,11857,11155,11688,11620,13086,13099,12667,13496,10878,10988,10046,9724,11184,11968,11571,11467,11109,11832,11668,10731,10939,11493,10164,9966,14449,14490,13641,13479,14415,14605,12985,13852,7293 ,7092,7503,7960,7740,7815,7856,7121,11591,10994,9211,10087,12719,13430,12895,13516,11423,11805,11098,11858,14444,14914,12777,13612,14560,14502,13154,13011,11657,11716,10718,11208,7529,7067,7766,7116,7578,7455,6094,5879,7873,6905,7540,7021,6120,6076,7351,7619,7593,7956,7096,7830,6639,7406,5999,6069,14855,14888,12774,13861,13469,13522,13196,14081,11500,10623,10179,10161,13849,13006,13101,13652,14531,14606,12764,13144,11452,11150,12041,11055,7788,7763,7485,7573,7969,6847,7515,7782,15377,14977,13405,13699,11819,11216,9974,9471,4082,4027,4071,4061,7711,7880,7079,7829,7122,7769,7027,6906,7390,6647,7602,7069,13127,1
3617,13583,13434,11110,11924,11873,11157,7538,7413,6099,5885,7022,7622,6879,7943,15372,14859,13013,1298
6,13760,13202,14611,14916,13537,13040,13156,13107,13637,13102,12727,13217,10135,10091,11577,11481,1462
7,14395,13485,13866,10186,9855,11846,12064,10967,11390,11682,10733,12778,13427,14505,14896,11597,11491 ,10156,9977,13968,12911,14450,14613,11916,11113,9213,10127,13920,13624,12959,13486,11624,10941,11806,11
171,13650,13027,14492,14423,11563,12038,11605,11713,6093,6128,7822,8004,6074,6013,7587,7781,10996,1157
4,11100,10739,13891,13845,15488,14533,10971,11888,11478,11063,11815,11162,11439,11914,14452,14506,1370
1,13204,10078,10193,11114,11672,6106,5615,7625,7517,7843,7399,7137,7735,4084,4055,4078,4062,7972,7596,7
029,7083,11661,11158,9599,9971,13591,12751,13524,13131,14397,15378,13423,12669,10182,10162,11876,11494 ,13960,13642,14867,14861,10742,12035,10071,9214,7138,7544,7888,7800,7124,7833,7070,6908,12785,13874,132
18,13109,14978,14617,13014,13249,13491,13470,14614,14862,13160,13706,12780,13538,7414,7085,7772,7511,7
949,7601,6115,6102,13620,12919,14513,14629,11173,11606,10094,10139,14724,15393,13862,13511,11578,11922,
11827,11451,8065,7727,7531,7786,6047,6007,7111,7411,13017,13433,13893,12988,14427,14920,14084,12731,76
28,7594,6117,6105,7030,6975,7827,7486,11728,10983,11598,11000,15105,14534,13595,13029,11484,11821,11121 ,11387,14508,14456,13666,13850,13644,13493,13133,13607,10734,11619,11512,10942,7955,7091,7849,7575,665
1,7405,7984,7033,11161,11864,10741,11116,9951,10099,11655,11087,7794,7128,7904,7634,7759,6895,5886,6122,
14537,14672,13208,12670,12096,11684,11232,11937,9719,10188,9978,10151,14398,14618,13873,13110,13713,13
139,14479,15365,10687,11847,11676,11609,15380,14439,13517,13018,10194,10105,11497,11944,7846,7086,8002 ,7567,7604,7527,7140,7836,10141,10209,10973,12037,13897,12786,14514,14630,9726,9980,11909,11580,11471,1
1067,11830,11174,13168,13544,13030,12733,13680,12759,14429,15394,7785,7958,7115,7621,6071,6108,7417,76
56,14980,14538,14928,14659,11874,11714,11122,11177,12923,13436,13984,13220,13868,12975,14728,14633,134
98,13708,13900,13613,14088,13191,13422,13113,11203,11659,10987,11505,13523,13649,12788,13865,7877,7034 ,7742,7518,6063,6011,6653,7950,11359,10745,11621,11095,13134,13958,13483,13033,15106,14443,14516,15616,
11164,12050,10102,10157,8066,7793,7093,7117,4088,3583,4075,4077,10974,11069,11803,11453,11851,11603,101
96,10093,13114,13020,14487,14545,11670,11498,11928,11626,14620,15363,13552,12734,14984,14430,13250,137
14,7541,7633,7852,7771,7144,7834,7036,7418,7582,7961,7534,7608,6121,6118,8012,7094,11205,11854,11970,11
479,13908,13224,14540,14634,13665,12763,14736,14944,10158,9967,11178,11124,10200,9723,10746,11567,1542
5,14688,14661,14869,11829,12044,10163,10142,10989,11610,11880,11185,7295,7875,7650,7971,7741,7007,6077,
6014,13141,13598,13155,12925,11206,11696,11921,10995,6129,6095,7595,6903,8008,7858,7845,7539,14491,145
46,13839,13518,14641,14883,13702,13195,13494,13955,13876,13621,11506,11099,10101,10183,12775,14096,146
36,14445,11667,11833,11628,11180,12983,13729,13375,13034,11454,11070,12049,11151,13116,13041,13898,131
42,13525,13614,15384,14520,11861,11822,12072,11111,10210,9919,10879,11720,7947,7152,7767,7626,7420,6654 ,7579,7796,11938,11575,11128,11612,13145,13656,14870,15396,13497,12792,13087,13643,14873,14451,12543,1
3252,11485,10719,11662,11508,15426,14503,14561,14662,13530,13197,14642,15108,10108,10047,10166,10187,1
1186,11972,11917,10990,14493,14992,13961,13847,7123,7636,7097,8072,7973,7533,7882,6907,13597,13007,146
65,14446,12042,11866,11633,11209,4083,4085,3839,4086,6124,5629,8016,7118,13431,12765,14453,14548,13905,
13203,13736,13668,10212,10169,10748,11853,14507,15374,12926,13036,15112,15400,13232,14016,13619,13515,
13157,13880,11101,11686,12097,11579,10997,11622,11210,11940,13716,12779,12987,13541,11483,11159,9979,1
0106,7597,7787,7857,7962,7359,7546,7773,7664,13639,13042,14666,15489,11834,11673,12066,11744,13471,138
53,14562,14885,11115,11875,11499,11102,13146,13906,13705,13764,10197,10079,12160,11915,7974,7835,7098,7
603,7878,7023,7125,7649,9215,10155,11685,10998,15379,14874,12766,13256,13548,12671,14723,14644,11389,1
1188,11599,12056,6107,6078,7850,7126,8068,7071,7

977,7783,13500,13198,14089,13103,14552,14752,13867,132 64,7591,7890,6130,6075,7487,7823,7964,7905,14607,14615,13158,13972,13921,13205,14494,14673,11836,11911, 11952,11217,14886,15008,15428,14454,13625,13529,14668,14915,11625,11163,11862,11212,13894,14112,13015, 13438,13730,12781,13645,13539,7623,7419,7139,7884,7545,8032,6909,7100,14876,15408,13964,13161,11674,11 551,10190,9975,4089,3967,4090,4087,7640,8005,7031,7581,14725,14509,13672,12989,11969,11001,11636,11117, 15373,14457,13854,13219,10216,10172,11447,11715,13611,14086,13653,13761,14889,14535,13044,13622,13148, 12787,15120,14515,13019,13936,13526,13111,11689,12052,11192,11926,13863,13210,13487,13962,10735,11502, 10095,10165,11884,11859,11581,11669,12065,10943,11611,11878,14564,14674,13162,13720,13709,13206,14648, 15872,11807,11976,11175,11925,15040,15490,13924,13542,11218,11865,11123,11002,14726,14510,12790,14083, 14890,14917,13221,13654,7129,7864,7141,7774,7957,7606,6119,6109,11486,10743,11698,11165,15382,14729,13 626,13970,14619,14458,14784,14689,11634,11509,10195,9981,7542,7789,6132,6103,7992,7831,7391,7860,8080,7 130,7627,7795,7889,7087,8003,7652,13875,13499,13776,13031,13646,13048,14897,15432,11118,11718,10975,12 039,13532,13869,13169,13435,7978,7598,7035,7985,4092,4091,4079,4031,10189,10224,11918,12100,14539,1439 9,12782,13667,7142,7739,7422,6910,7609,7853,7908,7790,13560,12990,14676,14730,15385,15617,13209,13912,1 2789,13164,14863,14918,13703,13135,14144,13732,13280,13985,14892,14517,10170,10109,11683,11877,14631,1 5395,14621,14568,10202,9711,11721,11613,12735,13895,13724,13657,14460,14541,13545,13992,11939,11495,11 233,11831,14518,14979,13021,14085,12068,11692,11125,11179,15492,14898,13957,13628,13519,13115,13878,13 222,11234,11640,11984,11896,11220,11929,11166,11004,14622,14921,13922,13762,11510,11181,11868,11607,120 45,11697,10211,10198,6126,6110,7881,6655,7629,7548,7837,8010,14635,14690,15381,14547,12161,11823,11627, 11882,13170,13225,14737,15440,14521,15397,13251,13707,10143,10103,11207,11507,13035,13553,14732,14680, 6136,5631,8096,7635,7132,7801,7896,7951,7543,7988,7145,7095,7798,8070,7851,7535,11724,11690,10213,10201 ,13407,12793,13669,13143,14922,14981,13212,14098,15618,14929,14871,14576,7146,7612,7980,7638,8017,7415, 7838,7037,15386,14542,13022,13117,13851,13501,14431,14663,8067,7605,7892,7859,6123,6125,7119,8006,1112 6,11071,11923,11582,13899,13651,14900,15136,7038,7959,6131,6133,7641,7797,7654,7906,13718,13546,13976,1 3674,13253,13902,14018,13527,14738,14692,13226,13172,12051,11187,11945,11671,12794,13615,13877,14092,1 0747,11501,12080,11129,14643,14637,14753,15496,13037,13658,14549,15402,11890,11224,12000,11730,11855,1 0991,9982,10218,11942,11182,12098,11663,14904,15456,13928,13233,11700,11623,11236,11932,15168,14924,13 254,13744,13969,13043,15371,15873,11881,12054,11211,11717,14522,14982,13554,13147,10167,10204,11513,11 752,11973,11130,11838,11614,14740,15427,14563,15232,7986,7519,7847,7153,7610,8018,7099,7883,10159,1010 7,10749,12046,12162,11889,11189,11213,14930,14754,13715,13881,13676,13228,14638,14985,13502,13118,1510 7,14696,14097,13199,13909,13870,7630,8074,8033,7148,7802,7965,7862,8073,14875,14447,14120,13159,15388,1 4667,12927,13768,13986,13623,13176,13660,13533,12767,13710,13556,11637,11729,11948,11867,15504,14550,1 3234,14020,14645,15398,13965,13038,14090,13914,15620,14524,5887,6134,7743,7651,7920,7549,7879,7975,112 40,11930,11132,11514,11678,12057,11630,11704,7637,7154,8128,7599,7101,8009,7127,7854,10217,10214,12108, 11190,14785,15409,13681,13257,14553,14744,14945,14932,12796,13901,14887,14986,7102,7658,8020,7912,6137 ,6015,7865,8082,11391,11971,11746,12067,14565,14495,13149,13734,14756,14646,14145,13627,11837,11103,10 173,10110,10225,10191,11691,10999,15429,14877,13045,13670,15624,15109,13258,13988,12104,11954,11941,11 635,14946,14993,14669,15401,12043,11248,11863,11722,7804,7644,7547,8036,7963,7885,7660,7131,13531,1320 7,14455,15434,13882,13721,14114,13792,13163,13923,13547,13150,11516,10750,11675,11892,14936,14675,1420 8,13963,11219,11732,11193,12168,15520,14554,13733,13046,12069,11629,11978,11003,14704,14988,13

437,13236,13647,14104,15367,14566,13884,13959,14000,13265,10220,9725,12112,11214,8076,7607,7156,7987,7893,7143,7982,7421,11693,11883,11953,12058,14727,14649,13673,13211,13910,13260,14786,14878,13722,13599,15874,14670,11455,11642,11869,11760,14017,13049,13684,13165,15412,14569,14891,15110,12070,11931,11194,11699,14511,14459,15491,14994,13495,13763,14948,14677,7791,8069,7642,7886,7657,8024,7861,7160,8097,7981,8011,7775,7613,7891,6911,8048,11974,11119,11221,11745,13737,14100,13240,13974,15113,14556,12783,13550,10203,10174,11946,11222,14650,15441,13932,13907,14760,15404,13629,13717,14731,15009,14113,12991,12164,11167,12073,11879,7868,7668,7133,7550,7898,7966,6138,6135,11687,11986,10226,10171,13659,13926,13855,14024,11583,11919,12060,12001,14919,14691,13223,13973,13266,13913,15632,15430,13171,13050,13534,12791,11719,11515,11235,11980,14623,14519,13746,13213,11641,12128,11005,11196,13682,13557,14570,15387,13166,13766,13023,14087,11736,12101,11127,11677,7979,7643,8088,8007,8034,7611,7147,7666,14461,14893,15552,14996,14952,14678,13966,14148,14652,15493,14577,15114,14899,15410,13731,13925,11225,11960,11237,11870,14681,14788,13769,13661,14733,14739,15448,14543,12053,11702,10215,10205,7907,7839,7994,7134,7149,8081,7866,7989,13987,13543,13281,13879,14116,13740,15876,15010,4094,4095,4063,4093,7639,7799,7909,8100,13173,13227,13282,13688,11638,11885,10228,10199,14894,15121,15436,14768,12088,11927,11487,11956,14032,13944,15375,14693,14523,15498,13268,13977,13214,13052,14572,15000,13558,13229,13916,13655,14093,13745,15648,14960,12176,11226,11723,11891,14923,15116,15416,15458,11985,11183,12099,11748,14209,13871,15041,14462,12074,11694,11131,12081,13675,13930,14578,15399,13255,13555,14901,14734,7631,7894,8013,7665,6140,6139,7103,8040,13772,13738,14682,14792,11238,11835,11518,11006,13174,13119,13971,13630,11705,11949,12004,11886,7407,8084,7914,8021,7653,7855,7900,7990,14099,13235,14694,14741,14639,14905,15880,14580,13993,13719,15494,15433,14931,15619,12795,13549,10222,10206,11977,10751,14128,13177,14525,14902,11725,11644,11933,12106,13938,13272,14048,13778,7155,8104,7928,8014,7806,7157,8129,7897,15012,15505,15390,15444,13903,13039,14697,15042,14925,15680,14551,15122,13990,13230,14146,13711,14983,14684,13748,13671,10232,9727,12192,11731,14755,14742,13284,13980,13929,14102,13259,13765,14800,150 16, 13561, 13800, 14021, 13178, 13886, 13662, 11228, 11897,11992,12047,15137,15405,14698,15500,11639,12084,11241,11191,12797,14094,14926,14745,11894,12166,11947,11631,11242,11708,12076,11734,15622,14906,14210,13937,12113,11511,11934,11133,15457,15124,15888,15442,12163,11701,11988,11955,13237,13261,14933,15411,14908,15522,13685,13777,8071,7672,7993,8026,6127,6079,7910,7655,10219,10221,11215,12102,14555,14647,15044,14934,11134,12055,10227,10229,15625,14937,13996,13915,8098,7863,7921,7039,7583,7150,8022,8035,14987,14757,13288,13978,15128,15138,13180,13562,8083,7805,7646,8130,7996,8078,6142,6143,14947,15383,13726,14105,14938,15508,14746,14567,7867,7916,7659,8041,7158,7614,7887,8075,13678,13752,15024,14989,14156,13238,13439,14019,13794,14115,13885,13151,15464,14584,15406,14705,11737,11893,11750,12002,13739,13047,14526,14700,14152,14002,15904,14990,15431,14995,13989,13683,12082,11615,11943,11249,11706,12114,11195,11979,11726,12170,12129,11244,15497,14671,14816,14651,14091,13296,14557,14706,15621,14949,13911,13770,11898,12061,11958,12169,15744,14758,13564,12798,9983,10230,11839,11747,12016,11645,11975,12071,14761,14787,13723,13940,11733,11250,12224,11695,15413,14950,14879,15634,14571,14748,14679,14708,13267,13780,15521,15111,13241,14216,14117,13677,7161,8112,8025,8038 ,7913,7661,7922,8085,14653,15875,14026,13051,14558,15435,14160,13262,14762,14789,13741,13931,14573,15460,14001,14106,7967,7803,8136,8019,7899,7645,7162,8044,11197,12105,11223,11950,13503,13690,14895,15506,13917,13808,14118,13979,15628,15169,13242,13747,7869,7135,8077,7983,7669,8099,8132,8028,11198,11754,12116,12008,10233,10111,11961,12178,14022,13167,15140,15048,15418,15170,13269,13793,14997,15389,13994,13
270,11900,11740,11643,12132,15144,15115,15553,1
4953,14940,15877,14769,15056,12059,11981,11756,
11227,15
152,15437,14212,13215,15512,15172,14121,13927,1
2172,11703,11252,12083,14683,15233,15472,14579,
11989,11
239,12078,11517,13735,14034,15633,14998,13631,1
3967,15936,14790,14654,15011,14108,14049,11887,
12165,11
738,11982,7870,8092,7924,7662,7164,7911,8049,799
5,13767,13563,13283,14028,11753,12120,11957,112
56,1544
6,14954,13689,14176,13053,13244,15417,15234,151
17,15650,13784,14149,15556,14712,13175,13725,12
193,1207 7,12107,11871,13273,14008,14764,15882,
13285,13918,14101, 13750,15001,15072,14903,
15443,11709,11987, 1100
7,12144,15528,15414,13686,13933,8037,8089,7901,7
674,8102,7615,7151,8144,15176,14961,14574,15495,
14695,1
4793,14735,15123,14136,13975,14927,15014,11964,
11764,11229,11646,13535,14004,14770,15013,15626
,15878,1
4224,13274,7991,8042,7667,8086,8105,8015,7915,76
73,11994,12062,10234,10231,13771,13939,14033,13
231,146
85,15636,14147,13796,15438,14581,15524,14794,12
075,11739,12184,12103,12130,11707,11243,11762,1
4122,137
42,15002,15449,14956,15889,13179,14129,13286,13
883,15499,15649,13566,13054,13753,13997,12003,1
1935,120
90,11230,14699,14463,14052,13934,11245,12177,11
962,12085,15403,14527,15461,15118,14743,14772,1
4025,127
99,14962,15554,13773,13692,14907,14801,13981,14
154,15017,14582,15043,15682,8056,7902,8133,8090,
7670,80
50,8027,7917,14240,13779,13276,13945,11735,1189
5,12005,12196,14040,14095,14686,15420,14935,150
04,15884 ,15126,13687,14132,15501,15656,14796,15
459,13289,13239,13942,14214,15536,14585,11727,1
1990,12109,11761 ,8101,7997,8120,7159,7895,8137,
7647,8106,7925,8029,8052,8160,6111,6141,7998,767
6,15018,16000,13995,1367
9,10236,10235,11199,12136,14909,15507,14747,151
39,13290,13756,15452,15125,15640,15045,14701,14
776,1412
4,13782,14161,13559,14964,15025,13982,13181,115
03,12180,12010,12117,14710,15560,14211,13749,14
759,1589
2,14036,14003,14802,15129,13263,14150,11749,119
51,11996,12086,13182,14103,15466,14586,14707,15
510,1378
5,13941,11251,12200,12024,12110,14817,14910,156
84,14749,11902,11253,12225,11993,15445,14939,14
702,1588
1,13798,14050,15623,15391,14804,15906,14130,136
63,14991,15236,15141,14951,12167,11768,12089,12
122,8116 ,7918,7163,8039,8131,8113,7926,7423,155
02,15020,13991,13297,10223,10175,12006,11751,15
745,15046,13754,1
4162,15523,14765,13243,14027,15130,14588,15450,
14709,14941,15568,15184,15026,13774,14218,15049
,14968,1
4177,13292,13946,14109,14006,14217,15652,14818,
15142,15468,13887,13795,15419,14763,14064,13693
,15513,1
5240,15905,14750,12194,11959,12017,11135,14023,
14119,15627,14559,15462,15890,13781,13298,11679
,11246,1
2118,12131,12179,11901,11742,12226,14999,15028,
15171,15664,8087,8043,8138,7807,8108,7929,7165,8
079,142
72,13743,14955,14808,12092,12174,10238,10239,13
245,14153,15473,14791,11963,12012,11755,12137,1
5132,155
25,15937,15145,15050,15584,15057,15173,15052,15
422,13271,13998,15638,15688,13246,13802,8030,81
45,7551,
7923,8134,8114,8023,7166,15200,15146,15509,1494
2,14164,14056,15530,15248,14009,14226,15439,150
58,15032 ,14713,13948,13788,13691,14180,15760,14
771,14107,14029,13804,13275,11254,11710,11983,1
2171,15629,15896 ,14220,13751,15153,15465,16128,
14655,13300,14131,14957,15516,11257,12208,12121
,12134,12009,11757,12018 ,12181,14037,13287,1514
8,14820,15681,14766,15908,15474,12063,11899,122
32,12115,15635,15174,15003,15555 ,11995,11741,11
258,12140,14126,13565,14824,15447,11965,11231,1
2173,12079,14575,14714,14795,14958,15746 ,14963,
13935,14213,14773,14716,13786,14030,8046,8091,7
903,8051,7671,8140,7930,8103,15537,15944,15154,1
5
514,13801,14168,14005,13304,8146,8057,8093,8161,
7678,7932,8054,8109,14241,14125,15630,14797,141
55,1391
9,15879,14832,15005,15526,13757,14035,15653,150
15,13055,14192,14012,13812,15476,15415,11765,12
195,1222
8,12124,13277,13694,14042,14110,15557,15060,151
77,15641,14965,15920,14687,14803,11966,12188,12
020,1175
8,15696,14774,15451,15073,14587,14798,14778,147
77,14123,13787,16002,14805,15885,14583,15019,15
532,1126
0,12007,12145,12091,14232,14151,14178,13755,121
33,12185,11997,11770,13291,13810,15562,15178,15
748,1546
3,15074,15480,12198,11711,11247,12240,14051,139
83,15644,15235,15938,15006,14138,13278,13293,14
225,1565
4,15119,15421,15185,14010,14133,8148,8045,8110,7
919,8152,7675,8115,8094,15891,15529,13783,13943,
12087,1 2138,11763,12182,15156,15912,15064,15264,15127,14703,14053,14244,15712,15237,13775,14038,15569,14966,14157,13809,8053,8135,8162,7871,8060,7999,8118,8139,15657,15021,15180,15540,14969,15047,13247,14184,12201,12111,12011,11769,13551,14228,15454,14589,15027,15637,15160,15511,14058,14165,15238,15022,16004,15558,13797,13999,15752,15469,15076,15683,12152,11998,12229,12186,11766,12146,12123,12013,14044,14134,15186,14711,15894,14780,13299,14248,15642,14806,15503,14819,15883,14751,14072,14158,12197,12093,12216,11255,13950,13301,14821,15241,14273,14041,15538,15131,14809,15576,14970,15080,14215,13816,15952,15188,14137,14170,15296,15658,15201,15029,14054,13799,11991,12233,11743,12202,15467,16130,15686,15133,15561,15940,15907,15242,14242,14007,15588,15051,15477,15666,14065,13183,8164,8121,7931,8058,8149,8031,7167,8107,12021,12125,12148,12256,15143,14810,14972,15515,10207,10237,12094,11772,15030,14590,13727,13294,8142,7927,8168,8124,8047,8117,8147,7933,15886,16001,14166,14179,15053,15407,15651,14911,15249,15776,15134,15147,14715,15544,14227,13949,15689,15527,13790,14274,15033,15900,14140,14222,14767,15478,14943,15564,12212,12014,11259,12135,14825,15660,14011,14060,15202,15059,13803,14185,12227,12209,12022,11519,14822,15909,15517,15570,15244,16129,15897,15054,13302,13758,15149,15700,14031,14219,14812,15192,12183,12139,12234,11903,15453,15747,15175,15665,15631,15482,15061,15034,15808,15250,13305,14256,15585,15088,15204,15155,8141,8176,8122,8061,8154,7663,8163,8150,15685,15150,14775,15265,14169,14182,15533,15914,14057,13805,14826,15475,14066,14229,14111,13947,16016,14959,14280,14163,15968,15672,14043,13789,15007,15534,15698,15075,12204,12025,11261,12175,13306,14188,15939,15893,14013,13279,15749,15252,12126,12241,11647,12019,15639,14799,15572,15179,12230,12210,12119,11262,15471,14717,16008,15690,12142,12187,11999,12147,14833,15922,15266,15157,15062,15297,15539,15518,14221,14127,15208,15754,8095,8055,8165,8153,7934,8170,8119,8156,14828,15586,15668,14967,13813,14243,14276,14172,14014,14236,15910,15559,15065,15481,15941,15036,14068,13806,16132,14779,13308,14055,14193,14139,15643,15077,14181,14233,15714,15898,15692,15541,15181,15655,15256,14718,11767,12236,12026,12199,15921,15158,15761,15187,15565,15066,15945,14834,12242,12153,12189,12257,14045,13818,15216,15592,15078,14781,15728,14807,11774,12028,12150,12205,14246,13759,13295,14288,14971,15484,16032,15268,15916,15023,14135,14186,15546,15756,15948,15661,13811,14230,16136,15239,15470,15161,14249,14159,15571,15697,14059,13817,14836,15913,15182,16006,15531,15081,14200,14046,12244,12141,12206,12015,15162,15068,14277,14234,15600,14782,15298,15762,15956,15272,15713,14811,13814,14194,15189,15646,15203,14973,15887,15566,14171,14061,15750,15243,12248,11771,12211,12190,15542,16003,15924,15669,14823,16144,14245,14141,15031,15777,15423,15082,12149,12231,12258,11967,14264,13303,15164,15089,15946,15190,15573,15662,14039,14281,13791,14250,8111,8059,8169,8166,8125,8062,8177,8143,15193,15704,15545,14840,15135,15691,14591,15300,14069,14173,15578,15245,14196,14304,16009,15895,15645,15055,15479,14813,15953,15251,15784,15716,12156,12095,12214,12235,14974,15084,14142,13820,15280,16064,15667,15563,15205,15928,15764,14827,15035,15589,14260,14062,12260,12217,12027,12154,12245,12127,11263,12203,15687,15090,13307,14183,15519,15901,15194,15954,15753,15812,14814,15304,15596,14719,14275,14257,15548,15246,16137,15151,15915,15312,14070,13567,15206,16020,15969,15253,14231,14187,15673,15577,14282,13951,15942,16160,15063,15486,15778,14829,15693,15587,14252,14073,8172,7677,8155,8126,8178,8123,8167,8157,12238,12023,12264,12220,16012,15209,13309,14223,15720,15037,15902,15267,15659,16134,15701,15809,15092,15670,15196,14835,15067,15984,15574,15159,15911,15258,15535,16010,14174,14289,15210,15768,15757,15254,13695,14067,14278,14258,15972,15590,12143,12213,12243,12029,14838,16131,14167,13310,15269,15702,14190,14235,15674,16018,15923,15547,15824,15079,15694,15096,12237,12272,12218,12157,15580,15917,15217,15483,1483

0,15715,
15608,15038,15257,15960,14837,15212,14047,14195,15751,15183,16192,15780,15328,16033,13815,14284,14074,
14247,8180,8151,8174,8158,8184,7679,8171,8173,14783,15943,15772,15705,14290,14201,15593,16040,14237,14
305,15069,16133,13822,14076,16005,15676,15567,15163,15926,15270,12250,11759,12259,12246,15970,15810,15
218,15273,12191,12151,12261,12249,15299,15755,15083,15601,15455,14841,15717,15191,15260,16146,14198,14
253,15070,15165,15899,15549,15947,15699,14292,14189,15766,15594,16024,15722,15301,15950,16066,15575,14
254,14063,15274,15220,8179,8181,7935,8182,8185,8063,8186,8183,14296,13819,14842,15663,15925,16140,1425
9,14238,15085,15706,15976,15281,15302,15792,16017,15091,12030,12266,12215,12252,15602,15195,14197,1427
9,15763,15929,15724,15276,15550,15166,16145,15247,12207,12155,12265,12262,15957,15918,16168,15207,1430
6,14015,14975,15816,16034,15671,15224,15708,15581,14815,15758,15604,14204,14143,14262,14283,15282,1606
8,16013,15086,16138,15962,15729,15305,14308,14265,14844,15949,15197,15782,16193,15675,15093,15718,1530
6,16036,15579,15255,14075,14202,15930,15769,16162,15840,15211,15971,15595,15198,12221,12158,12273,1223
9,14293,14175,16256,16011,13311,14251,15781,15094,12268,11773,12251,12222,15485,15284,15695,16152,1593
2,16007,16048,15313,15721,15259,15958,15308,15770,15647,14286,14071,16065,15097,15732,15213,14312,1426
8,15543,15811,15785,16148,15288,16022,14831,15598,14191,14261,15980,15955,15677,15765,16161,15039,1570
7,15974,12274,12219,12263,12253,15903,16072,15271,16021,15314,15961,15219,15098,15582,14839,15794,1526
1,15730,15605,14291,14077,15214,15814,15071,16135,14285,14320,16014,16196,14266,14205,15779,15973,1429
8,13807,15817,15709,16035,15591,15329,15927,12276,12247,12270,12254,16164,15788,15221,15275,15330,1573
6,16080,15992,15316,16025,15262,15100,15606,15277,15964,15703,16141,15793,14307,14294,16257,15919,1572
3,15978,14239,14199,15303,15603,15820,15786,14309,14297,15222,15167,16019,15678,16147,15283,16041,1576
7,14843,15597,16176,15225,15986,15320,16096,15826,15951,15087,14078,14314,16038,15278,16194,15759,1579
6,15719,15332,16028,15977,16150,15307,15813,14263,14300,15609,15848,16069,15226,15934,15710,14255,1420
3,14845,16142,16258,15985,15285,15309,12280,11775,12267,12269,15733,15825,16044,15963,15336,16026,1522
8,15610,15774,16153,15726,15800,14313,14310,16204,15286,15487,16067,15842,16163,15933,15199,14269,1420
6,14321,14287,15787,15095,16200,16050,16037,15731,8188,8187,8175,8127,8190,8191,8159,8189,16139,15344,1
5959,15818,15612,14846,15771,15988,15315,15828,15289,16264,16165,15725,16074,15099,12275,12277,12031,1
2278,14316,13821,16208,15310,15789,15979,16049,16154,15551,15738,15965,15856,16166,16027,15290,15795,1
6070,15215,15317,15841,14299,14270,16042,15318,16260,15263,16169,15975,15783,16082,14322,14267,15679,1
6015,16156,16097,15815,15611,15331,16076,15737,16224,15101,15292,12281,12159,12282,12279,15832,16197,1
5223,15773,15321,16056,15333,15966,16149,15798,14311,14301,15734,15981,14324,14295,16184,16023,15583,1
6052,16272,15322,15819,15987,16081,15279,16195,15844,16170,15790,15227,16177,12284,12283,12271,12223,1
5334,15931,15614,15102,15801,16045,16100,15982,14318,14302,16073,14847,15821,15740,16029,16202,14328,1
3823,16288,15827,15324,15993,16088,16143,15735,16180,15337,15287,15990,16262,16043,15727,15338,15804,1
6172,15830,16209,15607,16030,15229,16259,15797,16084,16051,14315,14317,15311,16198,15230,16151,14323,1
4325,15833,15989,15846,16098,16178,15711,16039,15345,15802,16210,15291,16075,15822,16266,16225,15340,1
5994,16157,16054,16265,14079,14326,15935,15843,16112,15741,16071,16167,15829,15346,16320,15791,15293,1
6201,15319,16046,15294,15850,16212,16104,14329,14207,16057,16274,15996,15836,15739,16228,16155,16077,1
5852,15323,16268,15799,15348,16179,16085,15335,16174,15613,15983,16261,15834,16078,15849,16216,16053,1
5352,16289,16173,16203,15967,15805,16083,15103,16240,16060,15860,15325,15742,16090,16158,14330,14327,1
6171,15835,16280,16199,16226,15803,15339,15858,16099,16031,16186,15326,15341,16273,16058,16181,12286,12287,12255,12285,15831,15991,16101,16292,15823,16086,16205,15857,14332,14331,15295,16232,15599,16276,16106,16213,15845,16047,16092,16182,15347,16296,16120,16206,15998,15349,16321,16089,16263,15864,16185,16218,14319,14271,16102,15847,16290,16055,16113,15231,15775,15342,16214,16227,16275,15997,15838,16322,16188,16270,14334,14335,16059,16108,15851,16233,15350,15806,16079,16267,15353,16304,16217,16230,16105,15853,16114,16277,16159,15995,16328,16211,16091,15837,15354,16236,16061,15327,16269,16175,15861,16291,16324,16220,16062,16284,16116,15854,15356,16103,16241,16187,16229,16281,16093,15866,16294,15807,15343,16336,16183,16234,15859,16278,16297,16207,16107,15865,16248,16094,16325,16282,15862,16242,16219,16109,16293,16189,16312,15351,16087,16329,15839,16298,16117,16221,16244,16352,14303,14333,16190,15868,16308,16110,15355,16231,16323,16305,16118,15615,16279,16235,16330,15999,16300,16121,15357,16271,16222,16337,15743,16115,16326,16306,16215,15358,16238,16283,16095,16243,15863,16332,16122,16295,16338,16249,16285,16353,15870,16124,16246,16301,16340,16237,16302,16111,16344,15867,16307,16286,16245,16327,16354,16063,16252,16191,16310,16331,16356,16313,16123,16250,16341,16223,15359,16299,16334,16119,16360,16316,16239,16309,16339,16125,16333,16368,16314,16253,16346,15855,16355,16342,16287,16247,16357,16345,16126,16362,16311,16348,16303,16251,16361,16358,16317,16254,16369,16335,16364,15869,16347,16318,16370,16315,16359,16349,16372,16343,16366,16350,16376,15871,16363,16365,16371,16373,16127,16374,16377,16255,16378,16375,16380,16379,16367,16319,16382,16383,16351,16381]

**Sequence group 6: Z6_16384**

[0,1,2,7,3,8,11,24,4,10,13,28,16,33,35,77,5,12,14,32,19,38,47,81,22,46,42,88,57,96,102,168,6,17,21,40,23,45,51,90,29,55,59,97,72,110,116,186,34,61,75,114,80,123,135,197,87,137,148,225,153,238,264,385,9,18,26,54,30,58,71,105,36,76,62,117,84,127,142,206,44,74,86,136,92,145,152,233,100,155,170,252,184,272,291,432,53,89,98,151,111,162,178,269,121,179,196,283,210,305,321,473,139,204,230,311,236,324,349,510,257,357,379,543,400,572,615,879,15,25,31,73,39,79,82,141,48,85,93,150,101,160,165,266,56,94,103,163,115,177,193,286,126,194,205,300,232,318,344,493,64,108,122,183,128,195,213,313,149,228,237,326,256,355,373,542,164,246,270,361,284,393,402,567,307,420,458,602,483,636,714,885,69,124,144,216,159,235,255,359,169,258,275,384,292,401,431,591,191,287,301,413,325,446,477,650,338,486,515,682,551,724,758,1039,212,314,332,462,362,492,519,703,397,539,568,748,604,762,846,1136,429,582,616,801,631,865,901,1201,709,929,967,1192,1011,1269,1375,1794,20,37,41,91,49,95,106,176,50,107,118,187,132,207,217,340,63,119,133,222,146,231,244,341,154,243,265,378,288,396,408,566,67,143,156,224,173,247,271,394,181,279,293,410,304,443,466,628,180,302,316,442,337,480,495,683,366,529,552,723,580,756,806,1101,78,167,174,277,190,298,315,433,198,320,330,475,350,508,533,721,259,345,363,513,386,549,577,750,423,586,622,794,653,862,916,1182,297,381,411,559,439,601,626,848,471,642,666,878,715,944,978,1243,516,711,725,968,751,1013,950,1297,821,1089,1137,1394,1149,1531,1607,1889,83,188,192,336,248,354,372,528,278,377,387,556,422,588,621,850,294,414,438,589,460,627,657,888,487,671,702,934,749,975,1035,1313,339,444,465,656,494,693,733,954,554,736,760,1031,822,995,1119,1412,599,786,856,1093,889,1148,1187,1486,945,1195,1194,1587,1299,1639,1699,2096,380,484,530,737,587,761,805,1051,623,849,867,1138,926,1157,1193,1525,660,897,960,1183,982,1199,1305,1641,1047,1326,1371,1709,1438,1817,1886,2309,722,972,1025,1307,1117,1316,1426,1752,1134,1418,1496,1845,1558,1925,2038,2502,1159,1544,1629,1965,1678,2068,2002,2567,1789,2153,2216,2754,2352,2848,3015,3419,27,43,52,99,60,120,134,214,66,138,147,221,158,241,245,390,68,157,166,240,175,299,308,428,200,310,335,472,352,497,531,746,70,172,189,303,202,333,346,490,215,358,374,540,392,573,596,764,229,382,405,584,434,620,637,828,448,629,673,896,680,932,973,1389,109,201,211,351,223,375,391,558,253,409,424,608,4

51,648,6
70,854,276,427,464,634,489,678,689,918,512,691,70
0,977,784,1014,1083,1414,295,488,506,698,548,727,
745,987,
576,783,811,1046,870,1102,1139,1501,607,845,892,1
145,946,1178,1253,1561,1021,1260,1330,1656,1372,
1727,18
34,2298,112,219,242,403,274,425,459,652,290,467,4
91,692,517,705,717,984,319,507,545,719,575,774,80
3,1042,6
05,826,868,1130,919,1160,1227,1506,347,557,595,80
7,638,857,855,1163,661,900,930,1202,989,1257,1285
,1661,7
04,947,1017,1270,1043,1345,1374,1760,1088,1406,1
475,1846,1575,1935,2061,2531,368,614,643,902,688,
943,991,
1261,771,1020,1066,1367,1070,1384,1433,1813,787,
1068,1087,1423,1175,1474,1550,1922,1240,1572,162
7,1968,1
693,2106,2178,2594,827,1189,1216,1509,1290,1591,
1638,2023,1331,1683,1763,2140,1835,2224,2323,278
5,1481,1
769,1853,2241,1962,2378,2427,2969,2025,2473,2565
,3063,2669,3228,3381,4006,129,254,282,470,317,505
,541,75
5,328,550,583,781,609,818,887,1229,360,597,651,85
1,675,941,921,1242,694,961,1010,1325,1062,1351,13
92,1790,
435,664,695,935,770,986,1026,1370,780,1065,1081,1
393,1116,1434,1485,1899,788,1098,1152,1483,1238,
1547,16
19,1971,1280,1671,1692,2113,1768,2179,2277,2733,
450,769,773,1044,793,1069,1129,1456,844,1176,121
3,1527,1
258,1598,1680,2073,1016,1231,1296,1621,1335,1724
,1771,2155,1439,1784,1872,2247,1964,2370,2407,29
59,1080,
1344,1422,1726,1482,1842,1906,2295,1556,1931,198
6,2404,2069,2475,2592,3137,1636,2030,2132,2564,2
211,263
6,2732,3242,2306,2757,2829,3370,2910,3539,3572,4
415,463,795,817,1225,985,1247,1284,1669,1033,131
7,1363,1
743,1430,1805,1897,2285,1085,1390,1477,1821,1523
,1909,1989,2397,1606,2066,1977,2459,2158,2575,26
68,3163,
1241,1487,1546,1943,1659,2006,2115,2554,1705,213
3,2210,2637,2273,2673,2805,3331,1838,2235,2318,2
741,243
5,2868,2949,3467,2498,3052,3106,3646,3229,3756,3
794,4238,1340,1551,1702,2138,1795,2196,2238,2716
,1887,23
47,2382,2822,2461,2869,3067,3566,1903,2443,2556,
3036,2666,3142,3147,3790,2765,3256,3319,3851,344
6,4036,4
135,4725,2076,2630,2638,3210,2818,3260,3372,3889
,2906,3466,3504,4096,3673,4140,4455,4954,3001,36
23,3723,
4294,3864,4337,4580,5137,3963,4614,4720,5330,485
6,5494,5607,6248,140,113,65,289,104,267,182,518,1
25,185,2
03,456,220,356,327,600,161,218,239,334,268,412,37
6,699,306,388,430,569,474,775,640,981,171,249,273,
395,309,
421,481,617,329,509,447,884,555,665,710,1385,353,
485,585,679,538,744,841,1167,610,816,772,1030,917
,1230,10
71,1762,199,296,312,461,348,496,565,718,383,633,5
11,759,598,789,864,1086,415,553,677,829,641,976,8
10,1135,
590,869,1012,1188,940,1450,1268,2152,449,674,611,
927,763,886,1040,1215,708,1099,966,1348,1027,128
9,1670,1
530,800,1050,1121,1497,1166,1368,1413,1816,1217,
1573,1459,2031,1657,2434,1923,2950,234,331,369,5
44,404,5
81,632,847,445,720,603,876,667,924,988,1306,476,6
39,765,933,701,1082,969,1281,792,1032,1153,1373,1
103,142
8,1553,1860,514,754,681,994,866,1063,1161,1403,84
0,1237,1084,1682,1203,1494,1507,1978,928,1150,13
24,1552,
1259,1597,1744,2484,1395,1788,1664,2021,1896,218
1,2276,3096,574,782,893,1131,820,1174,1287,1571,9
51,1360 ,1212,1841,1415,1626,1739,2112,1015,1252,
1429,1676,1526,1772,1970,2199,1327,1917,1804,239
6,2028,2308,256
6,3312,1067,1480,1559,1927,1366,1847,1999,2629,1
637,2102,2193,2406,1888,2755,2503,4244,1698,2141
,2246,27
17,2311,2585,2672,3535,2060,2826,2911,3209,3014,
3909,3380,5407,285,389,426,635,482,726,672,980,50
4,690,85
8,1038,768,1096,1156,1458,564,802,747,1128,863,12
71,1074,1524,942,1177,1304,1590,1224,1812,1725,2
465,606,
877,819,1388,1024,1162,1228,1599,925,1256,1341,1
956,1419,1667,1773,2217,1045,1457,1369,1840,1560
,1747,19
63,2305,1505,1916,2014,2375,2111,2518,2735,3184,
649,1118,903,1291,974,1484,1350,1852,1075,1402,1
533,1791 ,1596,1926,2024,2436,1186,1677,1508,218
9,1435,1958,2007,2675,1785,2099,2225,2536,2307,2
623,2831,3611,124
6,1708,1594,2039,1823,2154,2379,2811,1934,2458,2
195,2712,2272,3055,2944,3483,1640,2346,2584,2979
,2474,28
74,3278,3460,2639,3222,3097,3844,3427,3699,4037,
5586,732,990,1144,1451,1214,1522,1742,2072,1288,
1874,155
7,2139,1665,1988,2310,2807,1092,1620,1703,2270,1
844,2519,2192,2749,1987,2401,2464,3022,2098,3243
,2918,44
54,1391,1761,1924,2614,2075,2426,2371,3180,1822,
2496,2725,2968,2633,3078,3361,3749,2239,2677,257
4,3107,2

810,3555,3263,3859,2945,3382,3630,4087,3505,4002
,4581,4953,1476,1959,2123,2485,1875,2823,2593,32
08,2299,
2622,3007,3328,2724,3426,3668,4202,2022,2875,276
7,3445,3037,3722,3533,4158,3234,3578,3926,4073,3
835,468
7,4518,5178,2403,3143,2956,3687,3335,4266,3604,4
395,2827,3960,3795,4550,3850,4649,4853,6597,3101
,4219,40
97,4996,4013,4808,5092,5736,4373,5019,4921,5945,
5291,7245,5800,7789,367,457,532,757,594,785,859,1
158,630,
979,823,1312,920,1200,1380,1738,676,871,1041,123
6,955,1513,1298,1811,1097,1432,1595,2180,1407,18
61,1942,
2538,716,1034,983,1362,1120,1427,1570,1976,1239,
1679,1495,1902,1660,2029,2287,2701,1179,1618,154
5,2020,1
746,2218,2114,2631,1843,2271,2400,3373,2440,2958
,2830,3686,804,1064,1226,1512,1361,1574,1920,209
7,1151,1
628,1770,2188,1666,2353,2197,2784,1334,1820,1873
,2515,1704,2286,2460,3006,2067,2557,2325,2903,26
74,3100,
3261,3977,1504,1908,2122,2405,1998,2615,2537,316
7,2234,2820,2713,3079,2514,3279,3403,3922,1969,2
859,276
4,3329,3023,3579,3468,4159,2657,3447,3674,4667,3
834,4487,4336,5465,931,1381,1198,1745,1286,2110,
1681,244
1,1532,1810,1979,2415,1930,2322,2606,3185,1500,2
240,2015,2734,1907,2555,2499,3297,2194,2667,2907
,3103,28
19,3434,3538,4113,1658,2077,2304,2628,2383,2978,
2804,3622,2103,2748,3146,3482,2902,3383,3791,426
7,2442,3
082,2973,3559,3313,3962,3680,4409,3257,3820,4146
,4546,4012,4724,4812,6077,1839,2472,2198,2951,23
19,2828,
3136,3716,2539,3418,3062,3647,3211,3849,3927,458
8,2656,3330,3181,4003,3558,3888,4203,5176,3452,4
357,403
8,4686,4284,4920,5043,5700,2766,3191,3605,4112,3
402,4194,4394,4857,3805,4648,4260,5018,4547,5101
,5311,59
41,3698,4414,4664,5587,4852,5236,5406,6351,4326,
5487,5738,6198,5801,6487,6854,8096,1100,1431,134
9,2003,1
586,2107,1957,2595,1668,1898,2324,3000,2219,2676
,2849,3453,1753,2284,2159,2740,2497,3262,2821,35
73,2437,
2919,3083,3848,3190,3675,4039,4666,1921,2530,240
2,2957,2632,3054,3102,3717,2294,3166,3360,4072,3
532,397
3,3908,4797,2756,3371,3610,3865,3461,4147,4285,4
970,3296,4380,4134,4859,4522,5115,5290,6117,2074
,2374,28
06,3334,2607,3235,3567,4085,2972,3757,3435,3976,
2948,4218,4327,5003,3066,3534,3631,4671,3804,426
1,4470,5
606,3961,4644,4381,5100,4811,5237,5556,6237,3223
,3672,4086,4471,3845,4866,4645,5331,4239,4551,49
71,5449,
4721,5895,5638,6418,4007,4858,5093,5701,5244,602
2,5886,6705,5042,5765,6199,6953,6116,6589,7103,8
229,241
4,2700,2858,3554,3162,3923,3469,4372,3053,3681,3
669,4589,3858,4796,4523,5495,3318,4141,3821,4486
,4245,46
65,4997,5448,4084,4867,5067,5639,4813,5792,5963,
6704,3444,3972,4408,4809,4195,5114,4952,5739,429
5,5002,5
179,6249,5486,5887,5940,6952,4615,5379,5597,5962
,5310,6419,6118,6908,5136,6161,6588,7379,6381,71
02,7325,
8957,3748,4356,4519,5378,4810,5066,5596,6023,467
0,5177,5464,6119,5737,6536,6350,7113,4955,5557,5
764,648
6,5894,6236,6679,7551,5944,6739,6596,7324,6909,7
519,7721,9888,5245,5793,6076,6678,6160,6738,7041
,7518,63
80,7040,6855,7888,7244,7889,7720,8956,6537,7112,
7378,7898,7550,7899,8097,8499,7788,8228,8498,874
1,8740,9
889,9086,9087,130,131,208,251,209,280,323,440,226
,322,343,478,370,535,537,791,227,342,364,534,399,5
70,619,
825,436,618,592,860,669,912,948,1248,250,371,407,
578,437,613,655,890,479,663,697,913,776,970,1018,
1328,536 ,707,779,1008,824,1037,1095,1347,853,111
3,1164,1493,1181,1528,1616,2037,281,398,468,662,4
98,696,767,953,5
46,790,712,1019,842,1061,1132,1404,612,778,852,11
12,894,1147,1180,1511,922,1185,1250,1584,1318,16
42,1701,
2182,659,861,914,1173,971,1206,1266,1625,1029,12
67,1346,1685,1416,1755,1815,2293,1115,1400,1502,
1793,152
0,1818,1915,2398,1593,1941,2017,2481,2100,2600,2
703,3401,365,441,499,777,571,809,830,1123,624,843
,895,117
2,923,1204,1219,1622,668,898,949,1207,1009,1265,1
339,1694,1060,1342,1401,1736,1510,1808,1910,2369
,734,96
4,1036,1315,1072,1343,1421,1801,1165,1498,1521,1
832,1592,1933,2001,2480,1218,1562,1630,1967,1686
,2079,21
04,2573,1775,2136,2244,2664,2327,2758,2970,3413,
753,1048,1146,1436,1197,1515,1589,1961,1249,1604
,1649,20
36,1706,2101,2177,2627,1337,1695,1737,2131,1819,
2226,2317,2790,1900,2348,2425,2880,2501,3002,306
4,3719,1
420,1802,1862,2254,1984,2368,2439,2923,2087,2477
,2586,3032,2670,3080,3282,3916,2163,2610,2714,31
79,2747,

3337,3437,4077,2961,3471,3575,4068,3657,4247,445
3,5230,406,547,579,891,625,899,962,1264,654,963,1
022,132
9,1090,1405,1437,1904,713,1023,1091,1478,1154,15
03,1554,1905,1184,1549,1617,2016,1696,2086,2120,
2572,739 ,1133,1190,1492,1255,1563,1631,2084,128
3,1663,1707,2128,1754,2221,2274,2744,1282,1740,1
806,2220,1891,232
0,2373,2881,1990,2457,2512,2999,2608,3060,3188,3
863,808,1245,1262,1651,1336,1722,1803,2183,1364,
1814,185
4,2297,1918,2394,2467,2997,1605,1911,1985,2413,2
062,2487,2605,3034,2143,2620,2726,3176,2809,3332
,3454,40
58,1721,2019,2129,2553,2209,2659,2742,3284,2279,
2786,2846,3400,2971,3510,3602,4193,2432,2963,300
3,3576,3
035,3659,3552,4287,3241,3833,3917,4484,3925,4765
,4875,5377,831,1332,1338,1890,1568,1932,2000,245
6,1662,2
013,2063,2528,2142,2624,2719,3286,1710,2134,2208
,2625,2252,2743,2817,3416,2349,2851,2922,3498,30
33,3595,
3703,4325,1901,2222,2269,2816,2372,2905,3013,355
6,2516,3020,3076,3697,3258,3645,3893,4528,2651,3
158,331
4,3847,3417,3924,4065,4630,3511,4071,4070,4855,4
293,4937,5069,5748,2018,2344,2462,3021,2621,3077
,3187,37
59,2727,3285,3339,3918,3464,3975,4069,4749,2824,
3433,3564,4059,3608,4075,4297,4939,3751,4364,442
9,5079,4
590,5263,5350,6105,2998,3592,3683,4299,3891,4338
,4568,5112,3910,4544,4650,5307,4800,5471,5676,64
16,3979,
4780,4915,5539,5020,5698,5604,6473,5191,5873,594
6,6812,6162,6954,7189,7723,469,593,658,915,706,10
28,1094 ,1424,738,1114,1155,1473,1196,1535,1555,2
070,752,1191,1244,1534,1263,1723,1786,2162,1382,
1792,1885,2292,
1928,2377,2463,3030,766,1254,1333,1741,1386,1863
,1912,2354,1425,1960,2004,2478,2078,2601,2648,30
98,1499,
2026,2109,2612,2190,2718,2759,3270,2232,2745,285
7,3432,2872,3496,3593,4475,965,1383,1417,1919,14
79,2005,
2071,2552,1585,2121,2156,2692,2237,2788,2850,329
8,1650,2161,2268,2752,2351,2870,2883,3456,2412,2
901,292
0,3601,3156,3660,3803,4530,1711,2350,2392,2916,2
486,3005,3029,3615,2604,3155,3221,3750,3368,3866
,3919,46
69,2679,3281,3424,3921,3536,4056,4217,4803,3671,
4236,4366,4956,4430,5097,5288,6078,992,1449,1548
,2105,16
48,2157,2245,2808,1700,2275,2355,2904,2433,2947,
2975,3612,1809,2393,2483,2977,2603,3144,3183,374
0,2671,3
268,3362,3902,3457,4000,4133,4704,1913,2529,2635
,3189,2772,3315,3299,4005,2825,3436,3480,4078,36
21,4221,
4263,4969,2946,3537,3663,4256,3741,4393,4452,511
6,3832,4520,4607,5308,4835,5517,5679,6433,1996,2
702,278
7,3438,2882,3509,3629,4237,3139,3670,3784,4411,3
788,4472,4579,5261,3159,3786,3823,4549,4041,4606
,4792,54
68,4190,4832,4913,5544,5065,5794,5888,6522,3269,
4067,4102,4707,4270,4865,4936,5657,4367,5041,511
9,5858,5
289,5964,6123,6853,4625,5139,5329,5991,5536,6188
,6251,7115,5659,6365,6455,7223,6667,7450,7655,84
42,1073,
1588,1684,2278,1807,2381,2479,3039,1836,2500,261
1,3153,2693,3232,3415,4143,1966,2649,2791,3287,2
865,350
7,3459,4192,2908,3565,3656,4359,3772,4403,4482,5
228,2191,2844,2909,3499,3138,3614,3684,4428,3152
,3775,38
01,4483,3890,4582,4629,5391,3160,3860,3942,4627,
4188,4783,4905,5547,4258,5001,5064,5805,5138,588
9,6053,6
777,2236,3105,3141,3742,3165,3787,3901,4598,3280
,4042,4099,4751,4222,4872,5022,5703,3662,4145,42
86,4907,
4375,5094,5157,5875,4591,5188,5338,6021,5538,618
4,6223,7101,3800,4392,4548,5096,4626,5304,5420,6
075,479
8,5493,5558,6220,5699,6367,6520,7305,4922,5666,5
838,6454,5943,6634,6776,7478,6090,6815,6921,7622
,7034,78
55,7896,9035,2255,3177,3231,4115,3613,4201,4262,
4999,3701,4339,4407,5103,4576,5239,5389,6055,380
7,4480,4
613,5281,4727,5423,5585,6197,4874,5696,5549,6325
,5884,6475,6666,7357,4191,4631,4782,5519,4959,56
36,5807,
6446,5077,5839,5942,6635,6039,6673,6873,7613,529
2,5967,6120,6805,6261,6958,7043,7827,6410,7206,7
286,803
8,7451,8192,8224,8742,4382,4793,5070,5856,5231,5
920,5988,6706,5351,6135,6190,6902,6327,6959,7247
,7890,54
05,6315,6452,7204,6664,7306,7327,8194,6849,7504,
7597,8299,7816,8470,8619,9313,5726,6618,6644,743
4,6882,7
506,7652,8325,7032,7826,7844,8550,8043,8632,9045
,9542,7149,8035,8117,8896,8310,8913,9224,9779,83
91,9248,
9298,10014,9512,10206,10299,10882,1122,993,735,1
697,952,1623,1314,2438,1049,1319,1387,2242,1472,
1940,18
33,2658,1205,1448,1529,1884,1624,2130,2012,2917,
1774,2064,2176,2587,2296,3145,2774,3607,1251,156
9,1643,2
085,1787,2137,2321,2715,1837,2395,2227,3412,2517,2845,2962,4473,1929,2345,2613,2871,2476,3028,3277,4015,2694,3230,3140,3696,3455,4144,3789,5118,1365,1720,1800,2253,1914,2376,2559,2976,2027,2751,2399,3065,2650,3161,3336,3822,2135,2513,2867,3271,2775,3600,3220,3911,2626,3363,3658,4066,3506,4596,4246,5872,2233,2864,2695,3465,3081,3414,3720,4101,2960,3861,3574,4400,3685,4269,5000,4764,3178,3758,3895,4651,4014,4412,4529,5262,4103,4833,4605,5667,4957,6260,5469,7072,1514,1855,1997,2482,2108,2609,2750,3283,2223,2996,2665,3374,2847,3462,3620,4298,2316,2773,3099,3497,2921,3802,3577,4259,3164,3700,3943,4431,3867,4570,4795,5336,2424,3038,2873,3644,3338,3773,4001,4517,3276,4157,3806,5040,4079,4646,4705,5550,3470,3940,4358,4794,4223,4871,5108,6382,4485,5190,4984,5647,5388,5891,6052,7272,2602,3154,3425,3903,3240,4040,4265,4815,3553,4404,4098,5295,4531,4912,5099,5804,3661,4216,4571,5016,4750,5158,5546,5923,4365,5451,5238,6196,5664,6104,6472,7566,3785,4624,4801,5485,4410,5309,5599,6617,4923,5766,5901,6222,5376,6813,6417,8804,5068,5859,6020,6707,6107,6485,6672,7853,5678,6910,7035,7433,7188,8327,7654,10043,1687,2065,2160,2753,2326,3004,2856,3606,2380,2900,3316,3718,3104,3856,3974,4604,2558,3182,3031,3900,3333,4257,3792,4748,3508,4043,4296,4864,4114,5260,5095,6349,2678,3375,3233,4474,3682,4004,4142,4873,3463,4220,4383,5524,4545,4987,5159,5947,3743,4599,4413,5294,4802,5111,5537,6089,4685,5450,5644,6187,5803,6422,6779,7400,2789,3892,3439,4271,3594,4628,4402,5328,3793,4516,4767,5229,4870,5484,5658,6262,4064,5017,4706,5893,4583,5526,5637,6675,5189,5751,5965,6434,6091,6599,6923,8033,4200,5078,4868,5677,5283,5874,6189,6881,5516,6324,5903,6694,6038,7221,7038,7843,4938,6134,6484,7127,6366,7008,7548,7824,6645,7448,7273,8246,7737,8101,8471,10242,3012,3628,3920,4597,4100,4726,5102,5702,4268,5348,4799,5857,4985,5584,6106,6875,3846,4906,5071,6036,5306,6423,5900,6807,5559,6213,6348,7190,5750,7479,7036,9044,4481,5117,5470,6590,5725,6250,6185,7376,5282,6408,6737,7114,6633,7256,7621,8119,5989,6677,6474,7287,6880,7869,7517,8309,7039,7660,8036,8549,7845,8440,9225,9541,4612,5527,5837,6383,5349,6903,6521,7432,6079,6598,7151,7598,6736,7736,8040,8716,5656,7009,6851,7791,7205,8116,7847,8692,7476,8008,8358,8545,8245,9297,9066,9838,6215,7307,7074,8099,7615,8844,8010,8959,6911,8388,8225,9134,8298,9253,9455,11325,7275,8719,8551,9598,8469,9436,9724,10412,8941,9659,9523,10665,9891,11765,10468 ,12357,1991,2243,2466,3061,2634,3157,3317,3978,2746,3603,3259,4324,3458,4076,4468,5098,2866,3369,3721,4156,3557,4723,4292,5247,3857,4578,4869,5890,4521,5337,5518,6444,2974,3702,3609,4406,3894,4569,4814,5548,4189,5021,4647,5404,4968,5665,6073,6693,4057,4904,4781,5646,5110,5960,5806,6619,5305,6037,6212,7653,6312,7100,6922,8098,3186,3774,4132,4722,4405,4834,5466,5749,3941,4914,5156,5892,4986,6163,5921,6852,4374,5280,5339,6421,5076,6072,6326,7150,5697,6453,6133,7011,6674,7274,7507,8427,4684,5422,5836,6221,5598,6591,6435,7359,5966,6900,6695,7257,6420,7549,7663,8356,5545,6957,6848,7599,7191,8009,7840,8693,6647,7817,8088,9289,8244,9065,8912,10103,3481,4469,4074,5109,4264,5802,5023,6313,4766,5246,5551,6239,5492,6122,6538,7401,4668,5990,5645,6778,5421,6447,6411,7565,5902,6665,7033,7285,6883,7738,7854,8617,4958,5727,6088,6616,6191,7126,6872,8034,5767,6806,7326,7842,7010,7661,8195,8845,6314,7258,7125,7871,7567,8390,8090,9033,7505,8230,8634,9132,8468,9312,9452,10691,5293,6364,5922,7073,6121,6920,7304,8102,6445,7722,7222,8039,7435,8297,8359,9226,6646,7612,7377,8441,7870,8324,8717,9836,7818,8915,8496,9296,8846,9522,9721,10314,6850,7403,8011,8616,7662,8694,8958,9513,8227,9252,8806,9658,9133,9727,10013,10607,8100,9034,9254,10243,9454,9880,10042,11017,8898,10205,10414,10878,10469,11131,11536,12570,3862,4577,4401,5605,4854,5795,5525,6523,4998,5390,6132,7148,5961,6676,6955,7819,5113,6054,5885,6804,6409,7516,6901,7897,6263,7037,7259,8296,7402,8089,8497,9288,5467,6432,6214,7075,6632,7220,7284,8103,6074,7358,7620,8544,7846,8425,8326,9315,6814,7623,8032,8311,7825,8635,8847,9596,7564,8942,8618,9515,9084,9777,9890,10817,5724,6186,6874,7614,6539,7477,7891,8547,7124,8193,7739,8426,7042,8718,8899,9657,724

6,7852,8037,9291,8226,8807,9046,10298,8389,9250,8943,97 26,9439,9881,10240,10881,7449,8042,8548,9047,8247,9520,9251,10015,8743,9135,9597,10101,9299,10605,10312 ,11128,8443,9514,9725,10315,9882,10688,10470,11357,9720,10449,10879,11609,10816,11175,11745,12745,6238, 6692,6956,7868,7356,8357,7841,8940,7207,8091,8041,9227,8308,9314,9085,10207,7596,8633,8231,9064,8805,92 55,9599,10100,8546,9521,9723,10313,9453,10450,10667,11356,7790,8424,9032,9437,8695,9776,9540,10415,8897 ,9656,9839,10883,10204,10471,10606,11608,9249,10041,10297,10666,10012,11129,10818,11538,9778,10877,111 74,11937,11019,11744,11767,12895,8118,8914,9067,10040,9438,9722,10296,10689,9290,9837,10102,10819,1041 3,11172,11016,11747,9543,10241,10448,11130,10604,10880,11327,12073,10664,11359,11324,11766,11539,11939, 12075,13602,9883,10451,10690,11326,10876,11358,11611,11938,11018,11610,11537,12358,11764,12359,12074,1 2894,11173,11746,11936,12568,12072,12569,12571,12747,12356,12744,12746,12893,12892,13603,13600,13601,2 60,261,262,419,263,452,455,684,416,454,501,728,560,741,743,1125,417,500,502,740,563,798,875,1141,646,874,8 14,1208,957,1232,1294,1652,418,561,645,812,647,873,883,1210,729,939,959,1233,1076,1310,1376,1758,742,997, 1079,1322,1140,1399,1463,1781,1171,1489,1540,1937,1565,1982,2116,2581,453,562,686,938,730,958,1059,1301, 796,1124,998,1377,1168,1411,1518,1850,872,1078,1170,1488,1220,1537,1564,1973,1292,1567,1654,2056,1756,21 44,2215,2760,937,1209,1234,1543,1311,1634,1690,2125,1397,1691,1780,2167,1858,2281,2329,2897,1491,1848,19 54,2291,1980,2332,2445,3018,2081,2453,2571,3087,2652,3212,3343,4083,503,685,731,1077,799,1127,1142,1517, 880,1169,1221,1542,1293,1632,1645,2118,956,1222,1295,1635,1323,1689,1777,2186,1410,1778,1849,2264,1972,2 314,2428,2981,1052,1308,1398,1751,1452,1779,1877,2301,1541,1952,1981,2334,2080,2451,2561,3086,1644,2010, 2126,2469,2184,2597,2654,3195,2283,2720,2854,3266,2927,3408,3642,4105,1057,1408,1536,1880,1603,1975,205 9,2455,1653,2082,2147,2580,2228,2653,2739,3247,1767,2187,2265,2697,2333,2814,2913,3430,2418,2954,3027,35 70,3123,3712,3778,4479,1876,2302,2408,2862,2470, 2980,3051,3599,2617,3075,3196,3752,3272,3782,3982,4744,2 737,3226,3364,3897,3399,4045,4137,4889,3625,4185,4303,4860,4379,5045,5243,6102,644,797,813,1211,881,1223 ,1302,1688,882,1303,1378,1759,1460,1851,1881,2420,999,1379,1461,1894,1538,1955,2008,2421,1566,1995,2117, 2570,2212,2616,2688,3194,1055,1519,1600,1936,1673,2011,2127,2598,1749,2151,2229,2690,2280,2803,2878,339 6,1748,2266,2312,2802,2417,2924,2983,3571,2534,3057,3124,3679,3224,3776,3906,4641,1126,1647,1674,2149,17 66,2250,2303,2761,1782,2328,2358,2899,2446,3016,3069,3677,2083,2429,2471,3025,2582,3121,3217,3754,2723,3 238,3378,3886,3441,4034,4152,4822,2249,2577,2691,3151,2771,3265,3394,4008,2887,3422,3502,4082,3643,4232, 4334,4979,3048,3627,3713,4320,3755,4385,4242,5089,3953,4593,4745,5286,4757,5595,5723,6257,1143,1764,177 6,2416,2032,2450,2560,3056,2150,2569,2583,3148,2722,3244,3377,4010,2230,2698,2770,3245,2860,3395,3449,41 08,2955,3531,3598,4198,3753,4331,4467,5129,2419,2812,2877,3448,2982,3585,3725,4282,3126,3736,3780,4451,3 954,4371,4683,5332,3255,3870,4020,4601,4109,4756,4839,5446,4233,4863,4862,5655,5091,5819,5907,6608,2576, 2952,3058,3737,3239,3781,3905,4535,3379,4009,4047,4746,4174,4777,4861,5589,3484,4129,4288,4823,4342,487 9,5105,5821,4527,5142,5235,5937,5386,6145,6254,7005,3678,4328,4425,5107,4681,5132,5370,6032,4742,5342,54 80,6193,5630,6333,6542,7322,4779,5616,5797,6393,5862,6576,6458,7423,6097,6741,6808,7718,7052,7828,8095,8 651,687,815,936,1235,996,1396,1462,1878,1054,1490,1539,1893,1602,1993,2009,2590,1056,1601,1646,1992,1675 ,2251,2288,2736,1796,2290,2411,2896,2448,2993,3059,3746,1058,1672,1765,2267,1798,2409,2430,2966,1879,245 4,2562,3084,2596,3213,3252,3796,1953,2578,2661,3236,2762,3376,3409,3964,2840,3397,3541,4128,3568,4196,43 29,5269,1309,1797,1859,2447,1895,2563,2591,3150,2057,2689,2728,3300,2843,3428,3530,4018,2148,2731,2876,3 406,2965,3562,3581,4154,3024,3583,3596,4333,3868,4386,4575,5334,2231,2964,3010,3590,3120,3715,3745, 4355, 3216,3855,3915,4526,4062,4642,4747,5489,3275,3981,4116,4753,4234,4818,4993,5633,4397,5032,5154,5840,524 0,5987,6166,6998,1320,1883,1994,2655,2146,2729,2

855,3440,2214,2879,2967,3584,3049,3617,3665,4352,2315,30 11,3109,3667,3215,3838,3899,4514,3273,3958,4060,4738,4155,4784,4927,5514,2431,3149,3251,3907,3410,4021,4 019,4787,3485,4136,4186,4890,4361,5005,5053,5845,3616,4235,4389,5046,4515,5185,5242,6048,4592,5318,5435, 6194,5651,6363,6553,7355,2540,3342,3423,4138,3580,4207,4363,5033,3819,4396,4558,5227,4562,5264,5381,612 9,3871,4560,4587,5347,4807,5434,5622,6330,4976,5648,5763,6396,5897,6622,6762,7474,3959,4849,4916,5521,50 74,5663,5818,6507,5155,5879,6051,6708,6167,6828,7019,7757,5441,6057,6209,6897,6390,7118,7219,8013,6509,7 277,7421,8163,7585,8396,8605,9414,1453,2058,2166,2886,23 13,3009,3085,3771,23 56,3 122,3227,3 853,3 301,3938, 4107,4941,2468,3253,3431,4011,3543,4205,4169,4978,3586,4289,4378,5141,4554,5203,5284,6098,2763,3500,358 7,4199,3818,4354,4426,5234,3852,4557,4573,5285,4680,5382,5445,6291,3880,4610,4760,5443,4974,5619,5743,63 99,5048,5855,5896,6641,6056,6763,6977,7657,2842,3817,3837,4524,3885,4561,4737,5416,3980,4816,4909,5591,5 006,5674,5876,6581,4388,4943,5088,5745,5171,5984,6059,6743,5387,6092,6232,6907,6392,7078,7187,8003,4572, 5184,5346,5986,5442,6174,6306,6995,5628,6347,6438,7184,6577,7279,7472,8233,5816,6526,6696,7420,6803,754 4,7656,8414,7002,7725,7805,8574,7934,8803,8856,9871,2863,3887,3937,4925,4353,4983,5052,5853,4465,5133,52 07,6015,5374,6113,6289,6981,4585,5270,5437,6149,5555,6309,6441,7177,5722,6558,6413,7263,6746,7439,7584,8 303,4977,5447,5618,6379,5843,6462,6643,7406,5925,6697,6802,7545,6965,7589,7773,8503,6170,6879,7014,7697, 7227,7872,7981,8711,7310,8132,8214,8974,8397,9128,9174,9654,5180,5623,5910,6702,6103,6796,6886,7636,625 5,7047,7122,7798,7265,7873,8167,8842,6295,7243,7416,8128,7574,8238,8243,9170,7741,8428,8479,9223,8690,94 40,9551,10229,6584,7530,7546,8386,7794,8432,8600,9273,7930,8710,8756,9524,8997,9560,9895,10514,8065,895 5,9043,9734,9244,9781,10084,10693,9359,10114,10224,10886,10388,11022,11135,11760,1516,1321,1053,2213,13 00,2119,1750,3050,1409,1757,1799,2852,1892,2452,2335,3264,1633,1882,1983,2410,2124,2696,2568,359 1,2282,2 588,2738,3197,2898,3839,3420,4341,1655,2033,2145,2599,2289,2721,2925,3365,2357,3017,2815,4104,3127,3501, 3626,5265,2449,2953,3237,3563,3074,3744,3969,4791,3302,3936,3836,4450,4153,4942,4563,6050,1783,2248,230 0,2861,2444,2992,3193,3666,2579,3405,3019,3779,3254,3881,4044,4586,2699,3125,3561,3965,3421,4332,3914,47 43,3246,4061,4384,4848,4204,5402,5044,6740,2841,3542,3303,4175,3783,4106,4512,4911,3624,4611,4302,5200,4 427,5073,5854,5594,3896,4534,4709,5481,4790,5232,5333,6144,4917,5649,5419,6527,5841,7226,6331,7982,1974, 2359,2541,3108,2660,3225,3404,3983,2813,3676,3267,4080,3503,4172,4360,5106,2912,3411,3797,4197,3597,457 4,4321,5049,3884,4464,4761,5241,4643,5372,5625,6216,3026,3770,3569,4370,4046,4555,4785,5315,3968,4973,45 84,5878,4891,5454,5515,6414,4184,4758,5140,5624,5007,5673,6016,7292,5287,6096,5848,6505,6288,6765,6976,8 196,3214,3854,4117,4739,3952,4806,5055,5643,4243,5204,4908,6173,5335,5762,6011,6640,4387,4992,5373,5860, 5590,6060,6398,6799,5143,6321,6112,7176,6524,7004,7422,8472,4559,5440,5631,6335,5226,6195,6451,7529,581 7,6614,6793,7186,6256,7719,7323,9660,5906,6709,6906,7637,7007,7453,7588,8783,6552,7802,7935,8385,8094,93 01,8604,10955,2185,2589,2730,3407,2926,3714,3540,4340,3008,3582,4022,4478,3816,4608,4776,5418,3192,3898, 3747,4736,4035,5047,4566,5588,4206,4817,5104,5662,4924,6128,5985,7269,3274,4081,3939,5268,4424,4786,494 0,5675,4173,5004,5181,6384,5343,5851,6061,6809,4525,5417,5233,6172,5632,6019,6391,7001,5513,6320,6478,70 99,6639,7334,7659,8332,3429,4682,4139,5075,4330,5444,5202,6208,4567,5314,5601,6099,5672,6334,6508,7228,4 838,5861,5520,6781,5383,6386,6463,7591,6093,6611,6829,7380,7003,7511,7807,8927,4982,5936,5670,6543,6151, 6742,7119,7787,6362,7262,6795,7632,6964,8135,7976,8739,5820,7046,7452,8023,7278,7878,8446,8704,7547,839 4,8197,9216,8655,9019,9441,11106,3724,4362,4752,5403,4910,5554,6014,6580,5072,6234,5629,6703,5849,6440,7 006,7775,4600,5744,5911,6962,6192,7335,6792,7713,6439,7181,7268,8114,6610,8415,7962,9894,5271,6049,6332, 7502,6583,7218,7079,8328,6150,7308,7649,8012,7533,8178,8569,9081,6887,7593,7438,8215,7786,8827,8435,923
1,7977,8606,8970,9519,8757,9410,10085,10513,5436,6387,6671,7293,6235,7799,7473,8384,6999,7510,8071,8500,
7648,8654,8992,9626,6506,7879,7743,8689,8129,9042,8781,9594,8410,8862,9326,9489,9215,10183,9978,10702,7
183,8239,8000,9015,8523,9698,8920,9835,7803,9356,9175,10030,9222,10153,10385,12065,8209,9631,9525,10568 ,9433,10356,10628,11236,9817,10595,10453,11481,10823,12573,11300,13025,2535,2853,3068,3777,3250,3869,40
23,4778,3398,4335,3955,5128,4168,4888,5256,6010,3560,4063,4513,4972,4283,5541,5090,6127,4609,5380,5671,6
764,5319,6217,6378,7382,3664,4466,4343,5206,4708,5371,5642,6412,4975,5863,5455,6294,5844,6525,6983,7617,
4819,5742,5617,6504,6018,6810,6642,7531,6175,6963,7180,8601,7240,8002,7806,9014,3904,4556,4926,5540,520
5,5650,6328,6609,4759,5796,6058,6780,5850,7053,6797,7756,5170,6148,6233,7331,5924,6982,7264,8070,6559,74
17,7021,7903,7590,8208,8433,9397,5512,6308,6670,7185,6450,7503,7381,8307,6878,7796,7633,8179,7330,8447,8
623,9322,6397,7851,7740,8501,8115,8863,8712,9595,7569,8691,8998,10159,9214,9959,9780,10973,4187,5257,48
78,6017,5054,6638,5877,7241,5600,6126,6415,7203,6346,7018,7494,8333,5488,6896,6479,7658,6307,7407,7311,8
465,6794,7575,7931,8211,7795,8674,8802,9545,5842,6585,7000,7528,7123,8022,7772,8954,6615,7712,8242,8738,
7902,8607,9171,9699,7242,8182,8017,8831,8473,9358,9008,9865,8429,9208,9566,10026,9432,10228,10376,11649 ,6171,7276,6798,7983,7015,7804,8232,9036,7383,8650,8162,8975,8387,9221,9327,10096,7568,8502,8329,9411,88
30,9272,9627,10700,8696,9809,9442,10182,9728,10452,10603,11220,7742,8355,8921,9544,8622,9614,9834,10389 ,9189,10152,9668,10594,10027,10653,10875,11453,9018,9870,10156,11107,10384,10800,10954,11879,9758,1099
1,11238,11710,11301,11963,12222,13248,4640,5375,5201,6459,5654,6623,6385,7475,5852,6290,7020,8064,6811,
7592,7829,8697,6033,6980,6747,7696,7309,8434,7797,8857,7229,7963,8183,9220,8354,8999,9443,10158,6329,73
54,7182,8001,7532,8134,8210,9037,6994,8306,8568,9488,8780,9393,9300,10341,7724,8575,8926,9245,8705,9567,
9729,10554,8464,9820,9550,10391,9982,10675,10822,11669,6582,7098,7774,8522,7495,8411,8843,9517,8016,912
9,8675,9396,7980,9630,9759,10575,8166,8782,8971,10179,9188,9669,9914,11134,9357,10140,9821,10652,10359,
10801,11084,11749,8395,8996,9518,9915,9217,10402,10141,10887,9655,10031,10555,10969,10225,11435,11162,
11894,9415,10390,10629,11221,10804,11542,11418,12157,10602,11261,11711,12333,11668,12037,12439,13293,7
202,7616,7850,8826,8302,9323,8713,9816,8133,9009,8993,10097,9230,10340,9983,11023,8478,9561,9209,9958,9
661,10157,10569,10968,9516,10403,10611,11163,10377,11296,11487,12156,8688,9392,9864,10357,9615,10674,1
0512,11239,9735,10574,10703,11761,10990,11419,11452,12332,10115,10923,11109,11486,10874,11895,11670,12
292,10692,11689,12036,12691,11885,12438,12673,13837,9080,9808,9979,10922,10358,10610,11108,11543,10178 ,10701,10972,11671,11237,12032,11878,12449,10515,11085,11260,11962,11434,11748,12135,12859,11480,12171,
12064,12672,12293,12839,12993,14340,10805,11297,11648,12134,11688,12170,12397,12838,11884,12396,12223,
13076,12572,13077,12992,13836,12033,12448,12690,13090,12858,13091,13249,13495,13024,13292,13494,13677,
13676,14341,13878,13879,1454,1455,1856,2035,1857,2164,2331,2800,1938,2330,2423,2914,2542,3071,3073,3883 ,1939,2422,2532,3070,2619,3198,3367,3957,2768,3366,3248,4032,3529,4148,4240,4988,2034,2543,2663,3218,276
9,3341,3443,4110,2915,3487,3589,4149,3840,4322,4390,5152,3072,3619,3843,4376,3956,4477,4603,5187,4017,46
53,4788,5453,4821,5592,5740,6541,2165,2618,2884,3486,2994,3588,3799,4281,3110,3882,3640,4391,3970,4553,4
740,5316,3340,3842,4016,4652,4118,4755,4820,5523,4170,4837,4990,5652,5134,5822,5909,6766,3451,4033,4150,
4805,4323,4894,5038,5761,4449,5039,5186,5881,5340,6035,6131,6993,4655,5312,5490,6101,5552,6146,6319,717
8,5669,6377,6481,7289,6612,7488,7619,8621,2533,2801,2995,3841,3199,3913,3966,4711,3392,3971,4119,4804,41
71,4892,4919,5746,3528,4130,4241,4895,4377,5037,5175,5898,4552,5182,5313,6008,5522,6124,6310,7077,3726,4
300,4476,5131,4564,5183,5345,6109,4789,5482,5553,6164,5668,6361,6457,7288,4918,5634,5798,6395,5882,6587,
6620,7437,6063,6700,6904,7572,7023,7726,8014,863

7,3769,4532,4754,5384,4877,5543,5661,6389,4989,5720,583
3,6540,5926,6613,6761,7515,5173,5899,6009,6691,6147,6830,7013,7770,6292,7048,7217,7892,7321,8066,8164,90
39,5344,6110,6218,6926,6436,7076,7231,7967,6595,7281,7454,8124,7586,8180,8458,9316,6751,7498,7634,8323,7
703,8525,8677,9493,8005,8715,8859,9468,8985,9663,9893,10774,2662,3111,3219,4111,3393,4131,4290,5036,344
2,4291,4398,5153,4594,5317,5385,6304,3641,4399,4595,5438,4762,5491,5626,6305,4836,5621,5741,6480,5904,65
94,6668,7436,3739,4741,4850,5452,4995,5635,5799,6592,5051,5847,5927,6688,6034,6825,6966,7700,5050,6012,6
114,6824,6259,7016,7097,7893,6442,7261,7328,8047,7496,8160,8352,9243,3912,4981,5034,5835,5172,5950,6111,
6767,5224,6130,6210,6997,6322,7146,7271,8045,5721,6311,6437,7201,6554,7295,7493,8126,6711,7508,7650,832
0,7785,8520,8698,9450,5949,6483,6689,7405,6801,7571,7698,8460,6979,7758,7822,8620,8015,8778,8918,9613,72
24,8007,8067,8860,8127,8987,8824,9731,8413,9213,9317,9956,9325,10301,10411,10921,3967,5168,5174,6258,56
40,6360,6456,7260,5846,6477,6555,7352,6710,7512,7639,8462,5938,6698,6800,7513,6924,7699,7793,8648,7049,7
831,7966,8754,8125,8903,9023,9757,6293,6826,6961,7792,7096,7929,8093,8828,7332,8112,8176,9017,8430,8973,
9277,10008,7563,8278,8474,9219,8649,9324,9465,10138,8779,9471,9470,10387,9733,10465,10613,11256,6482,70
44,7266,8113,7509,8177,8335,9131,7651,8461,8527,9318,8708,9395,9469,10245,7800,8673,8840,9451,8924,9491,
9753,10467,9083,9812,9885,10627,10098,10811,10910,11665,8046,8900,9011,9755,9275,9782,10044,10672,9302,
10024,10154,10855,10352,10987,11188,11892,9399,10316,10431,11059,10596,11218,11132,11949,10771,11373,1
1482,12204,11690,12334,12509,12995,2885,3249,3450,4151,3618,4448,4602,5368,3738,4654,4763,5433,4876,560
3,5627,6578,3768,4851,4980,5602,5035,5951,6094,6750,5258,6100,6253,6992,6344,7117,7267,8122,3798,4994,51
69,6013,5266,6219,6316,7054,5369,6388,6460,7282,6586,7489,7560,8198,5483,6510,6637,7500,6782,7638,7727,8
438,6876,7701,7849,8672,7876,8752,8901,9919,4301,5259,5341,6323,5439,6461,6579,7404,5653,6669,67
44,7608,
6885,7768,7830,8466,5834,6749,6960,7716,7051,7874,7895,8700,7200,7901,7964,8917,8276,8988,9187,10010,59
39,7050,7144,7960,7294,8069,8121,8939,7492,8275,8393,9082,8572,9246,9319,10177,7595,8457,8652,9321,8800,
9448,9629,10355,8995,9652,9814,10516,9886,10649,10820,11650,4368,5401,5620,6621,5832,6745,6905,7784,590
8,6967,7055,7928,7225,7979,8019,8936,6125,7145,7291,8021,7491,8240,8331,9068,7587,8436,8570,9294,8701,94
08,9549,10200,6317,7353,7535,8353,7752,8475,8467,9413,7801,8676,8736,9494,8953,9649,9671,10553,7978,880
1,8991,9664,9069,9833,9892,10676,9212,9980,10111,10872,10383,11025,11191,11925,6448,7618,7759,8678,7894 ,8777,8969,9653,8235,8994,9148,9867,9168,9916,10083,10809,8279,9150,9211,10029,9445,10110,10336,10984,9
610,10380,10429,11060,10609,11298,11420,11966,8437,9467,9538,10203,9702,10401,10464,11169,9815,10601,1
0679,11370,10821,11496,11683,12221,10117,10695,10885,11503,11056,11704,11763,12451,11171,11881,11947,1
2559,12111,12734,12907,13454,4565,5660,5880,6978,6115,7121,7283,8131,6168,7320,7499,8273,7609,8408,8639 ,9563,6394,7561,7771,8463,7865,8759,8703,9612,7932,8841,8984,9811,9144,9851,9954,10772,6783,7820,7933,87
55,8234,8938,9012,9884,8272,9147,9185,9955,9274,10086,10137,10927,8300,9240,9354,10119,9608,10319,10425 ,11063,9666,10573,10608,11321,10694,11421,11557,12173,6884,8213,8237,9070,8305,9151,9293,10106,8456,944
6,9527,10247,9650,10408,10598,11223,8990,9565,9730,10427,9819,10630,10697,11375,10099,10768,10906,1154
1,11058,11692,11727,12437,9184,9832,10028,10648,10118,10852,10956,11615,10342,11021,11086,11724,11219,1
1883,11964,12653,10454,11186,11354,11946,11455,12078,12172,12750,11654,12207,12329,12890,12390,13063,1
3088,13859,6927,8321,8399,9547,8937,9625,9670,10571,9021,9783,9855,10655,10080,10803,10925,11559,9191,9
952,10113,10813,10231,10959,11105,11709,10410,11216,11081,11873,11416,11951,12110,12677,9611,10139,103
18,11027,10519,11160,11323,11942,10625,11355,11454,12079,11555,12129,12257,12869,10848,11499,11680,122
01,11841,12354,12399,13035,11890,12554,12650,13182, 12735, 13268, 13288, 13678,9822,10337,10614,11368,1077 5,11448,11500,12158,10911,11687,11706,12290,11875,12355,12575,13078,10953,11847,11944,12552,12108,1265
4,12675,13270,12217,12832,12865,13343,13028,13490,13587,14041,11234,12070,12104,12730,12262,12834,1290
4,13397,12388,13034,13056,13550,13211,13588,13861,14182,12505,13179,13265,13736,13394,13741,13892,1433
1,13447,13992,14022,14434,14124,14518,14559,14918,4710,4369,3727,5905,4280,5747,5130,7230,4533,5135,526
7,6898,5432,6376,6165,7570,4893,5400,5593,6252,5760,6690,6476,7961,6062,6556,6760,7455,6996,8241,7754,89
23,4991,5641,5823,6593,6095,6701,7017,7635,6169,7147,6831,8636,7333,7821,8006,9917,6345,7045,7501,7875,7
280,8120,8445,9435,7610,8398,8236,9016,8699,9564,9169,10678,5225,5948,6108,6925,6318,7116,7419,8020,651
1,7715,7179,8165,7562,8301,8524,9210,6699,7329,7867,8439,7755,8916,8392,9303,7514,8571,8986,9466,8758,10
104,9662,11372,6877,7864,7611,8709,8181,8638,9040,9537,8004,9241,8858,9848,9013,9701,10572,10300,8322,9
130,9279,10155,9434,9868,10009,10810,9539,10381,10109,11187,10517,11840,10985,12432,5542,6211,6449,729
0,6636,7497,7714,8459,6827,8044,7573,8602,7823,8706,8952,9754,7012,7753,8199,8753,7965,9186,8861,9667,83
04,9020,9355,9887,9247,10046,10339,10904,7216,8130,7877,8972,8526,9145,9409,9977,8444,9593,9190,10600,9
495,10142,10201,11082,8714,9352,9810,10338,9651,10407,10668,11886,9957,10770,10556,11167,10924,11423,1
1556,12620,7490,8274,8653,9295,8412,9444,9697,10379,8825,9852,9526,10851,10011,10428,10651,11320,8989,9
628,10047,10592,10246,10698,11062,11451,9813,10971,10802,11708,11184,11664,11948,12862,9149,10116,1035
3,10989,9866,10873,11111,12069,10455,11262,11437,11726,10920,12205,11893,13696,10612,11371,11540,12159,
11667,11961,12128,13061,11190,12294,12391,12729,12508,13399,12906,14439,5883,6557,6748,7717,7022,8068,
7848,8922,7120,7900,8476,9038,8212,9228,9394,10108,7418,8330,8123,9292,8521,9665,9172,10244,8776,9447,9
752,10400,9546,10808,10631,11877,7594,8603,8409,9918,9010,9412,9562,10409,8707,9648,9823,11028,10025,10
559,10699,11483,9071,10107,9869,10850,10354,10671,11057,11653,10181,10970,11164,11695,11303,11922,1217
5,12692,7769,9276,8679,9703,8902,10136,9850,10884,9173,9976,10303,10773,10406,10988,11170,11842,9464,10
593,10202,11433,10087,11030,11161,12131,10769,11259,11497,11926,11655,12067,12331,13177,9624,10626,104
04,11189,10815,11374,11705,12261,11024,11872,11439,12154,11554,12557,12394,13039,10466,11686,11960,124
55,11882,12384,12856,13032,12105,12732,12621,13338,12997,13253,13491,14554,8092,8968,9320,10105,9536,1
0230,10654,11222,9700,10908,10343,11369,10557,11104,11666,12259,9218,10426,10615,11552,10854,11923,114
36,12203,11087,11721,11876,12510,11258,12751,12392,13860,9953,10677,10986,12038,11233,11762,11693,1268
8,10814,11888,12169,12450,12077,12616,12889,13267,11501,12133,11950,12651,12260,13073,12837,13393,1239
5,12908,13180,13549,13057,13452,13893,14181,10112,11031,11353,11887,10909,12291,11965,12728,11651,1206
6,12507,12866,12168,12996,13208,13672,11168,12385,12219,13027,12553,13264,13059,13604,12748,13092,1344
2,13545,13337,14021,13874,14334,11723,12655,12434,13251,12871,13700,13094,13839,12295,13444,13289,1389
0,13342,13997,14123,15029,12623,13675,13551,14210,13489,14044,14292,14652,13833,14215,14179,14773,1434
3,15377,14668,15477,6443,6899,7270,8161,7534,8277,8477,9398,7702,8919,8431,9756,8702,9492,9912,10650,78
66,8573,9041,9592,8829,10227,9732,10807,9229,10082,10405,11422,9981,10905,11026,11940,8018,9022,8925,98
54,9278,10045,10378,11080,9609,10597,10143,10952,10552,11185,11613,12153,9449,10424,10317,11166,10670,
11484,11322,12071,10853,11553,11720,12905,11844,12436,12330,13250,8334,9146,9548,10226,9853,10382,1097
4,11257,9353,10430,10696,11432,10558,11691,11449,12220,9818,10812,10907,11921,10624,11612,11874,12506,1
1217,11945,11685,12387,12130,12622,12835,13451,10180,10958,11352,11725,11110,12039,11927,12679,11498,1
2288,12155,12617,11920,12857,12911,13440,11061,12353,12216,12867,12511,13093,13036,13605,12107,13029,1
3212,14017,13336,13873,13740,14515,8737,9913,9490,10669,9696,11302,10599,11845,10302,10806,110

83,11751 ,11020,11682,12034,12693,10176,11502,11165,12174,10957,11943,11891,12861,11438,12109,12389,12649,12263,
12998,13062,13585,10518,11235,11652,12068,11707,12454,12256,13178,11263,12202,12674,13038,12386,12909,
13271,13701,11846,12618,12453,13075,12863,13446,13214,13857,12833,13294,13590,13888,13488,14040,14120,
14803,10849,11880,11450,12433,11681,12328,12652,13254,11941,12994,12558,13183,12731,13341,13443,13894,
12106,12868,12689,13453,13074,13396,13673,14332,13030,13743,13492,14020,13702,14178,14289,14650,12218,
12695,13095,13584,12910,13606,13838,14125,13291,13996,13698,14214,13889,14295,14433,14771,13252,13858,
13998,14555,14122,14336,14438,14937,13738,14517,14654,14914,14669,14943,15108,15546,9242,10081,9849,11133,10386,11299,11029,11967,10570,10926,11684,12504,11485,12132,12335,13031,10673,11558,11417,12200,11889,12836,12289,13089,11843,12393,12619,13340,12694,13213,13493,14016,10975,11924,11722,12435,12076,12556,12648,13255,11614,12678,12888,13544,13058,13449,13398,14043,12206,12891,13176,13395,13033,13591,13703,14208,12860,13834,13586,14127,13876,14329,14342,14805,11232,11694,12258,12870,12035,12749,13079,13547,12452,13269,12999,13450,12398,13674,13739,14213,12574,13060,13181,14019,13290,13699,13862,14558,13445,13994,13835,14294,14047,14337,14552,14917,12733,13210,13548,13863,13339,14176,13995,14435,13679,13891,14209,14513,14023,14769,14648,14940,13455,14126,14293,14651,14338,14800,14670,15105,14288,14665,14915,15273,14804,15027,15277,15549,11750,12152,12352,13072,12676,13441,13037,13832,12555,13215,13209,13895,13392,14042,13877,14519,12864,13589,13295,13872,13697,13999,14211,14512,13546,14177,14291,14649,14121,14666,14775,15104,13026,13448,13856,14045,13607,14328,14180,14655,13737,14212,14335,14919,14516,14671,14770,15272,13993,14437,14557,14774,14432,14941,14806,15110,14330,14913,15026,15381,14939,15276,15379,15859,13266,13742,13875,14436,14046,14290,14556,14801,14018,14333,14514,14807,14653,15024,14936,15279,14183,14553,14664,14942,14768,14916,15031,15473,14772,15107,15028,15378,15111,15383,15475,15862,14339,14667,14802,15030,14912,15106,15275,15382,14938,15274,15109,15478,15376,15479,15474,15858,15025,15278,15380,15544,15472,15545,15547,15551,15476,15548,15550,15857,15856,15863,15860,15861,520,521,522,527,523,832,835,1000,524,834,837,1004,904,1105,1107,1581,525,836,838,1104,907,1110,1279,1609,910,1278,1274,
1712,1441,1728,1734,2256,526,905,909,1272,911,1277,1355,1714,1005,1359,1443,1729,1576,1830,1868,2362,1106,1445,1579,1866,1608,1947,2047,2389,1615,2049,2092,2545,2169,2646,2792,3345,833,906,1002,1358,1006,1442 ,1471,1825,1108,1580,1446,1869,1612,1951,2054,2494,1276,1578,1614,2048,1716,2089,2168,2641,1732,2171,2258,2708,2360,2832,2931,3520,1357,1713,1730,2095,1831,2202,2338,2797,1945,2339,2388,2891,2506,2985,3089,3705,2051,2492,2550,2991,2644,3092,3173,3830,2777,3205,3323,3951,3384,4052,4215,5031,839,1001,1007,1577,1111,1583,1610,2053,1352,1613,1717,2094,1733,2200,2205,2794,1440,1718,1735,2203,1867,2337,2385,2894,1950,2386,2493,2940,2640,3046,3168,3765,1464,1828,1946,2343,2040,2387,2509,3041,2093,2548,2645,3094,2776,3203,
3309,3950,2204,2686,2798,3289,2892,3353,3386,4031,2987,3492,3650,4178,3731,4276,4506,5061,1469,1948,2088,2520,2175,2643,2711,3207,2257,2778,2835,3344,2932,3385,3519,4127,2367,2895,2941,3477,3093,3550,3709,4314,3130,3734,3875,4442,3991,4540,4678,5463,2508,3042,3116,3654,3290,3764,3879,4495,3357,3947,4048,4660,4180,4690,4934,5712,3517,4094,4224,4825,4255,5009,5125,5865,4501,5193,5279,5824,5395,6029,6279,7154,908,1109,1273,1715,1353,1719,1826,2336,1354,1827,1870,2363,2044,2495,2521,3132,1447,1871,2045,2526,2090,2551,
2684,3133,2170,2683,2793,3322,2928,3356,3472,4030,1467,2055,2172,2544,2261,2687,2799,3354,2341,2839,2933,3474,2984,3547,3690,4252,2340,2942,3044,3546,3129,3728,3767,4443,3294,3929,3992,4539,4092,4676,4830,5613,1582,2207,2262,2837,2366,2938,3043,3521,2390,3088,3114,3707,3174,3828,3933,4537,2779,3169,3291,3873,3346,3989,4089,4662,3495,4122,4230,4770,4317,4966,5148,5790,2937,3325,3475,3999,3527,4177,4250,4944,3695, 4306,4418,5030,4507,5216,5322,5979,3876,4503,4541,5296,4663,5397,5222,6081,4885,5577,5713,6338,5733,6651,6791,7345,1611,2364,2384,3128,2704,3202,3308,3928,2838,3321,3347,3996,3494,4124,4229,4946,2934,3478,3526,4125,3652,4251,4345,5080,3735,4423,4494,5198,4661,5303,5459,6153,3131,3548,3689,4344,3766,4461,4621,5250,3994,4632,4688,5431,4886,5363,5687,6372,4167,4730,4960,5581,5081,5732,5811,6534,5217,5827,5826,6755,6083,6847,6971,7704,3324,3732,3930,4633,4123,4689,4829,5499,4231,4945,5011,5714,5166,5757,5825,6629,4348,5121,5272,5791,5326,5831,6137,6857,5479,6182,6275,6989,6470,7193,7342,8109,4538,5300,5425,6139,5685,6156,6426,7080,5710,6402,6560,7237,6718,7397,7646,8422,5759,6680,6837,7461,6934,7676,7554,8519,7141,7857,7944,8810,8184,8928,9167,9747,1003,1275,1356,1731,1444,1944,2046,2510,1466,2050,2091,2525,2174,2681,2685,3350,1468,2173,2206,2680,2263,2939,2988,3516,2488,2990,3119,3704,3200,3809,3931,4658,1470,2260,2365,2943,2490,3117,3170,3762,2511,3206,3310,3948,3352,4053,4164,4692,2549,3326,3389,4120,3522,4228,4277,4900,3632,4253,4433,5120,4440,5196,5301,6301,1829,2489,2507,3175,2527,3311,3351,3998,2709,3473,3512,4208,3635,4312,4422,4950,2836,3515,3688,4274,3761,4438,4457,5150,3872,4459,4492,5321,4728,5398,5571,6374,2935,3760,3826,4490,3988,4543,4657,5355,4088,4719,4843,5478,5014,5614,5715,6565,4183,4933,5084,5729,5218,5786,5997,6721,5413,6004,6202,6888,6276,7031,7210,8082,1864,2523,2682,3387,2834,3513,3651,4316,2930,3691,3763,4460,3877,4497,4509,5352,3047,3827,3985,4511,4055,4702,4827,5474,4181,4898,5012,5706,5151,5768,5955,6570,3171,3997,4163,4831,4278,4961,4951,5771,4349,5124,5194,5866,5357,6001,6045,6893,4496,5219,5409,6030,5475,6241,6278,7088,5576,6358,6515,7238,6735,7415,7669,8483,3304,4214,4307,5126,4456,5215,5359,6005,4699,5412,5530,6271,5534,6296,6465,7173,4731,5532,5575,6407,5783,6514,6686,7394,5976,6732,6835,7464,6949,7730,7906,8562,4899,5813,5928,6573,6066,6759,6846,7607,6203,6939,7091,7812,7211,7952,8147,8849,6529,7105,7253,7985,7458,8218,8291,9113,7625,8377,8517,9263,8669,9484,9693,10478,2041,2710,2890,3694,3045,3825,3949,4675,3112,3990,4095,4717,4209,4882,5063,5957,3288,4165,4315,4947,4435,5213,5161,5978,4462,5273,5394,6181,5510,6247,6336,7142,3523,4416,4463,5199,4698,5354,5426,6274,4716,5529,5569,6337,5684,6466,6533,7363,4732,5610,5752,6531,5974,6683,6819,7467,6040,6919,6948,7745,7104,7907,8053,8773,3634,4697,4701,5476,4769,5533,5705,6496,4932,5784,5917,6631,6002,6774,6936,7681,5408,5959,6080,6821,6207,7028,7107,7859,6471,7136,7312,7991,7460,8202,8263,9103,5568,6240,6406,7030,6530,7234,7370,8079,6716,7411,7522,8260,7677,8379,8560,9361,6844,7630,7780,8516,7939,8628,8772,9506,8106,8813,8893,9682,9054,9907,9940,10951,3655,4771,4881,5953,5353,5983,6044,6917,5457,6157,6267,7063,6430,7165,7361,8061,5573,6302,6517,7197,6627,7373,7525,8253,6790,7674,7481,8363,7862,8535,8668,9387,5977,6535,6682,7431,6891,7558,7747,8506,6985,7781,7938,8629,8049,8681,8869,9635,7214,7971,8142,8789,8315,8964,9093,9827,8418,9236,9338,10038,9485,10172,10218,10742,6228,6687,6974,7810,7155,7924,7974,8748,7343,8171,8222,8886,8365,8965,9267,9934,7367,8339,8508,9204,8666,9366,9371,10214,8821,9552,9623,10275,9790,10500,10623,11253,7684,8614,8630,9458,8882,9556,9684,10321,9050,9826,9872,10560,10065,10636,10983,11490,9153,10007,10131,10790,10288,10841,11116,11673,10435,11158,11248,11850,11392,12014,12103,12656,2052,1865,1465,2929,1824,2795,2342,3878,1949,2361,2491,3648,2524,3204,3095,4176,2201,2522,2647,3118,2796,3476,3320,4491,2986,3348,3518,4049,3706,4703,4304,5325,2259,2705,2833,3355,2989,3493,3729,4225,3113,3829,3551,5060,3995,4417,4502,6297,3201,3733,4121,4439,3946,4656,4929,5775,4210,4880,4700,5430,5149,5958,5535,7090,2391,2936,3040,3653,3172,3808,4029,4510,3327,4273,3831,4679,4166,4733,5008,5574,3479,3993,4437,4901,4305,5320,4842,5711,4126,5013,5396,5812,5212,6490,6028,7856,3633,4434,4211,5167,4691,5062,5472,5919,4500,5611,5278,6244,5427,6065,6918,6650,4824,5498,5689,6561,5774,6272,6373,7192,5929,6733,6499,7631,6889,8314,7395,9094,2642,3115,3305,3984,3388,4093,4272,4935,3549,453

6,4179,5
028,4419,5164,5356,6138,3708,4279,4693,5197,4493,5570,5297,6041,4768,5456,5753,6277,5615,6428,6713,7300,
3874,4674,4441,5362,5010,5511,5769,6355,4928,5973,5572,6938,5867,6550,6571,7482,5192,5734,6180,6712,600
3,6773,7064,8404,6339,7140,6912,7605,7360,7909,8052,9328,4054,4718,5085,5707,4884,5782,6047,6731,5223,62
64,5916,7233,6375,6834,7059,7744,5399,5996,6429,6932,6630,7108,7466,7927,6183,7389,7164,8252,7628,8108,8
518,9616,5531,6528,6719,7399,6270,7239,7543,8613,6845,7710,7921,8262,7344,8811,8423,10748,6970,7813,799
0,8749,8111,8553,8680,9903,7668,8890,9055,9457,9166,10349,9692,11935,2893,3349,3514,4275,3730,4542,4432,
5324,3824,4458,4962,5462,4696,5608,5756,6498,4028,4826,4659,5704,4967,6031,5562,6628,5214,5785,6136,675
8,5952,7172,7029,8369,4182,5029,4883,6300,5424,5770,5956,6775,5165,6000,6229,7444,6403,6915,7109,7945,54
77,6497,6273,7232,6720,7067,7459,8105,6569,7388,7582,8207,7735,8454,8775,9416,4313,5686,5127,6067,5302,6
532,6246,7252,5563,6354,6653,7143,6772,7398,7624,8316,5810,6933,6572,7917,6467,7446,7559,8683,7137,7707,
7953,8488,8107,8599,8895,9995,5982,6988,6770,7647,7199,7858,8219,8875,7414,8362,7923,8744,8048,9239,908
8,9843,6856,8170,8552,9123,8378,8978,9582,9804,8631,9478,9329,10268,9763,10091,10501,12082,4620,5358,57
28,6491,5918,6626,7062,7680,6064,7314,6717,7811,6913,7524,8110,8871,5580,6820,6975,8030,7236,8455,7920,8
797,7523,8257,8368,9182,7706,9507,9062,10982,6303,7089,7396,8590,7683,8290,8203,9404,7198,8416,8765,911
2,8625,9286,9673,10165,7975,8685,8534,9339,8874,9923,9559,10283,9089,9694,10022,10551,9873,10474,11117,
11489,6516,7447,7763,8405,7315,8887,8561,9456,8083,8598,9159,9632,8764,9762,10060,10722,7606,8979,8823,
9789,9205,10130,9901,10662,9498,9946,10374,10537,10259,11231,11038,11730,8259,9367,9100,10079,9639,107
62,9988,10931,8891,10432,10219,11070,10274,11201,11389,12941,9333,10731,10561,11532,10485,11344,11620,
12232,10893,11563,11465,12417,11819,13389,12272,13765,3295,3649,3932,4677,4162,4729,4963,5758,4254,532
3,4887,6152,5160,5864,6284,7058,4436,5015,5473,5972,5251,6601,6082,7171,5609,6464,6771,7908,6359,7301,74
30,8490,4508,5458,5327,6266,5688,6427,6730,7480,5975,6935,6551,7366,6892,7629,8063,8733,5787,6818,6681,7
604,7066,7946,7746,8615,7235,8031,8256,9685,8336,9102,8894,10078,4828,5528,5954,6600,6265,6734,7392,770
5,5735,6836,7106,7916,6914,8185,7925,8848,6206,7196,7313,8451,6984,8062,8364,9158,7675,8509,8149,9031,86
82,9332,9557,10457,6568,7372,7762,8261,7542,8591,8489,9391,7970,8884,8745,9287,8450,9583,9715,10370,746
5,8947,8820,9633,9183,9947,9828,10663,8657,9791,10066,11211,10258,11015,10840,11993,5195,6285,5830,7065 ,6046,7734,6937,8337,6652,7170,7483,8271,7410,8146,8582,9417,6564,7984,7583,8774,7371,8507,8419,9601,792
2,8667,9051,9335,8883,9770,9906,10585,6890,7685,8104,8612,8223,9122,8868,10006,7711,8796,9370,9842,9030,
9695,10215,10763,8338,9306,9117,9927,9617,10434,10072,10945,9553,10252,10642,11066,10484,11252,11348,1
2501,7215,8376,7926,9095,8143,8892,9360,10124,8491,9746,9262,10039,9459,10273,10375,11124,8656,9634,940
5,10475,9926,10320,10723,11728,9796,10861,10502,11230,10780,11464,11579,12212,8822,9423,9989,10584,971
4,10714,10930,11393,10237,11200,10756,11562,11067,11629,11831,12413,10090,10950,11208,12083,11388,1178
0,11934,12743,10830,12007,12234,12614,12273,12855,13134,13960,5612,6431,6245,7555,6754,7731,7445,8563,6
916,7362,8148,9152,7947,8684,8929,9797,7081,8060,7863,8788,8417,9558,8885,9941,8317,9063,9307,10272,942
2,10067,10503,11210,7393,8482,8258,9101,8624,9238,9334,10125,8078,9390,9672,10536,9900,10445,10348,1133
3,8812,9683,9994,10289,9805,10643,10781,11506,9600,10900,10622,11395,11042,11643,11818,12541,7682,8206,
8870,9638,8583,9499,9935,10549,9116,10173,9771,10456,9092,10730,10831,11547,9266,9902,10023,11215,1023
6,10757,10998,12102,10433,11196,10901,11628,11347,11781,12060,12645,9479,10064,10550,10999,10269,11402 ,11197,11851,10743,11071,11507,11985,11249,12367,12142,12794,10479,11394,11621,12213,11788,12470,12350,
13017,11578,12253,12615,13185,12540,12933,13311,14053,8270,8732,8946,9922,9386,10371,9829,10892,9237,1 0073,10061,11125,10282,11332,11043,12015,9622,10637,10253,11014,10749,11209,11533,11984,10548,11403,11595,12143,11349,12264,12427,13016,9788,10444,10944,11345,10715,11642,11488,12235,10791,11546,11731,12657,12006,12351,12412,13184,11159,11907,12093,12426,11830,12795,12542,13164,11672,12585,12932,13499,12765,13310,13469,14445,10164,10860,11039,11906,11346,11594,12092,12471,11214,11729,11992,12543,12233,12896,12742,13313,11491,12061,12252,12854,12366,12644,12991,13615,12416,13043,12940,13468,13165,13583,13721,14928,11789,12265,12500,12990,12584,13042,13273,13582,12764,13272,13135,13840,13388,13841,13720,14444,12897,13312,13498,13850,13614,13851,13961,14219,13764,14052,14218,14349,14348,14929,14526,14527,2042,2043,2504,2707,2505,2888,3091,3544,2546,3090,3135,3710,3306,3935,3945,4735,2547,3134,3292,3934,3359,4050,4227,4897,3524,4226,4160,4964,4421,5144,5220,5992,2706,3307,3391,4090,3525,4213,4319,5082,3711,4351,4489,5145,4712,5298,5410,6200,3944,4499,4715,5392,4896,5461,5583,6243,4949,5681,5772,6549,5789,6648,6816,7645,2889,3358,3692,4350,3810,4488,4695,5249,3986,4734,4504,5411,4930,5509,5708,6356,4212,4714,4948,5680,5086,5731,5788,6575,5162,5809,5994,6752,6158,6858,6973,7910,4347,4965,5146,5781,5299,5870,6026,6833,5429,6027,6242,6941,6400,7083,7175,8077,5683,6352,6566,7153,6624,7194,7387,8254,6769,7429,7601,8401,7708,8576,8735,9713,3293,3545,3811,4713,4051,4841,4902,5691,4248,4931,5087,5780,5163,5868,5931,6822,4420,5122,5221,5871,5393,6025,6227,6950,5508,6230,6353,7056,6574,7168,7374,8201,4622,5276,5460,6155,5560,6231,6405,7161,5773,6562,6625,7208,6768,7413,7553,8400,5930,6722,6838,7463,6942,7687,7728,8533,7111,7808,7988,8664,8151,8814,9114,9741,4673,5496,5730,6468,5829,6603,6757,7457,5993,6788,6865,7644,6986,7709,7905,8611,6225,6951,7057,7779,7195,7954,8141,8854,7364,8172,8289,9000,8421,9154,9264,10127,6404,7162,7302,7998,7520,8200,8319,9075,7695,8381,8554,9200,8670,9304,9586,10364,7883,8586,8746,9403,8795,9641,9773,10541,9105,9831,9943,10532,10049,10751,10981,11774,3390,3987,4091,5083,4249,5123,5274,6024,4318,5275,5414,6201,5578,6357,6469,7368,4505,5415,5579,6518,5754,6567,6714,7369,5808,6685,6817,7600,6968,7694,7760,8532,4635,5709,5814,6548,5999,6723,6839,7692,6043,6895,6987,7776,7082,7949,8050,8792,6042,7060,7166,7948,7347,8144,8205,9001,7526,8361,8448,9143,8584,9260,9420,10287,4840,5981,6006,6867,6224,7026,7163,7911,6268,7174,7254,8081,7390,8250,8371,9141,6789,7375,7521,8269,7670,8407,8581,9202,7815,8596,8766,9400,8873,9636,9798,10522,7025,7603,7777,8505,7937,8659,8790,9588,8055,8850,8910,9712,9115,9878,9986,10713,8312,9107,9155,9944,9203,10051,9920,10783,9505,10257,10365,11012,10373,11293,11411,11905,4903,6204,6226,7346,6728,7412,7552,8360,6894,7581,7671,8480,7814,8608,8751,9590,6990,7782,7936,8609,7996,8791,8881,9744,8173,8931,9074,9858,9201,9971,10095,10829,7365,7950,8029,8880,8204,9049,9165,9924,8452,9180,9284,10089,9554,10037,10325 ,11048,8643,9382,9618,10271,9745,10372,10529,11182,9879,10535,10534,11391,10789,11473,11597,12244,7602,8168,8366,9181,8597,9285,9419,10175,8767,9589,9643,10366,9824,10447,10533,11277,8888,9769,9932,10523,9992,10539,10793,11475,10167,10868,10965,11607,11126,11799,11870,12529,9142,9968,10075,10795,10323,10842 ,11096,11640,10350,11064,11202,11827,11336,11999,12196,12792,10459,11308,11459,12043,11564,12210,12100,12841,11743,12337,12418,13116,12586,13186,13357,13723,3693,4161,4346,5147,4498,5428,5582,6424,4634,5682,5755,6513,5828,6655,6715,7678,4672,5815,5980,6654,6007,7027,7138,7882,6286,7152,7341,8076,7408,8217,8367,9198,4694,5998,6205,7061,6298,7303,7384,8186,6425,7456,7556,8382,7686,8577,8640,9330,6563,7626,7733,8588,7918,8750,8815,9574,7968,8793,8945,9768,8976,9856,9969,11003,5277,6287,6401,7391,6519,7557,7679,8504,6753,7761,7860,8724,7973,8852,8930,9602,6866,7881,8028,8808,8175,8966,9003,9800,8268,9029,9072,9985,9380,10052,10235,11050,6991,8174,8248,9060,8406,9157,9197,9999,8580,9379,9477,10166,9680,10290,10367,11213,8687,9585,9760,10369,9904,10520,10729,11339,10063,10740,10870,11492,10966,11625,11816,12502,5360,6489,6684,7729,6864,7861,7989,8872,6972,8051,8187,9

048,8313,9091,9119,9996,7169,8249,8403,9121,8579,9368,9407,10148,8671,9572,9674,10334,9801,10472,10621,11240,7385,8481,8627,9421,8836,9619,9603,10477,8889,9772 ,9840,10542,10005,10733,10759,11505,9090,9905,10055,10752,10149,10929,10980,11644,10256,11040,11151,11828,11379,12021,12199,12801,7540,8734,8851,9774,9002,9877,10021,10741,9363,10062,10208,10947,10212,11000,11115,11797,9383,10210,10255,11069,10505,11150,11328,11996,10710,11376,11457,12048,11593,12266,12360,12882,9573,10531,10566,11243,10766,11401,11472,12177,10871,11577,11647,12322,11817,12428,12547,13133 ,11177,11675,11849,12447,12040,12604,12659,13315,12179,12757,12823,13375,12979,13530,13687,14170,5561,6756,6940,8054,7167,8221,8383,9207,7212,8420,8587,9377,8725,9496,9743,10639,7462,8641,8855,9591,8961,9875,9803,10712,9052,9933,10048,10863,10188,10939,11010,11772,7919,8908,9053,9859,9362,9998,10076,10964,9376,10191,10233,11011,10322,11118,11181,11919,9384,10284,10398,11179,10708,11311,11441,12051,10754,11545,11592,12277,11674,12361,12485,13081,7972,9337,9365,10150,9389,10211,10333,11142,9584,10506,10563,11279,10734,11408,11566,12215,10054,10641,10782,11443,10895,11622,11701,12339,11127,11740,11858,12469,12042,12600,12639,13309,10232,10928,11068,11624,11178,11824,11956,12499,11334,12013,12062,12636,12211,12759,12880,13457,11466,12186,12302,12822,12415,12962,13080,13542,12514,13119,13169,13662,13258,13815,13848,14491,7999,9401,9487,10587,9997,10721,10758,11535,10093,10843,10943,11631,11112,11783,11917,12487,10239,11008,11157,11809,11255,11959,12081,12613,11410,12208,12053,12717,12348,12843,12978,13485,10711,11183,11310,12023,11495,12140,12279,12814,11605,12303,12414,12963,12479,12985,13137,13653,11820,12431,12544,13109,12669,13190,13275,13795,12786,13366,13430,13934,13531,14024,14048,14350,10902,11329,11598,12320,11775,12400,12444,13018,11871,12567,12606,13158,12719,13191,13391,13842,11933,12707,12820,13364,12976,13458,13471,14026,13129,13568,13645,14083,13784,14198,14259,14633,12230,12954,12972,13522,13146,13570,13684,14101,13256,13794,13804,14238,13939,14264,14501,14750,13333,13931,13973,14400,14094,14409,14584,14867,14135,14600,14626,14974,14728,15062,15083,15330,5690,5361,4623,6969,5248,6823,6154,8318,5497,6159,6299,7986,6512,7428,7209,8658,5869,6488,6649,7340,6832,7778,7580,9061,7110,7672,7904,8555,8080,9369,8838,9991,5995,6729,6859,7693,7139,7809,8145,8747,7213,8251,7955,9740,8453,8909,9106,11001,7409,8169,8589,8967,8380,9196,9581,10487,8726,9486,9364,10088,9799,10640,10213,11646,6269,7024,7160,7997,7386,8216 ,8511,9120,7627,8799,8255,9265,8642,9385,9640,10254,7783,8449,8963,9575,8839,9984,9476,10351,8610,9675,10050,10530,9874,11140,10750,12336,7969,8960,8727,9825,9305,9742,10128,10565,9104,10285,9942,10936,10077,10765,11544,11292,9402,10174,10327,11203,10486,10948,11049,11798,10567,11377,11149,12187,11493,12668,11997,13296,6602,7255,7541,8402,7732,8585,8798,9587,7951,9140,8665,9686,8911,9806,10004,10794,8140,8837 ,9331,9857,9073,10234,9945,10755,9388,10092,10399,10967,10291,11098,11331,11856,8288,9206,8977,10036,9642,10189,10473,11037,9580,10661,10238,11576,10543,11198,11241,12054,9830,10396,10862,11330,10735,11407,11636,12766,11013,11742,11520,12151,11916,12363,12484,13416,8578,9378,9761,10335,9504,10504,10761,11351,9921,10940,10562,11823,11051,11456,11627,12276,10053,10728,11099,11560,11278,11702,12050,12403,10869,11987,11782,12612,12184,12528,12840,13622,10209,11176,11337,12005,10946,11829,12095,12953,11467,12254,12373,12638,11904,13117,12793,14372,11596,12323,12468,13019,12531,12853,12984,13813,12198,13166,13259,13521,13356,14103,13686,14987,6943,7673,7880,8809,8150,9156,8944,9990,8220,9028,9620,10126,9336,10280,10446,11148,8510,9406,9199,10332,9637,10753,10216,11276,9876,10507,10792,11400,10586,11796,11623,12741,8686,9687,9497,11002,10074,10476,10638,11409,9807,10732,10903,12028,11065,11523,11703,12419,10151,11143,10949,11822,11338,11639,12041,12513,11229,11986,12148,12603,12275,12798,13083,13504,8853,10324,9775,10767,9970,11180,10938,11848,10217,11036,11295,11773,11406,12004,12178,12670,10528,11561,11242,12365,11119,12030,12141,12987,11741,12247,12429,12802,12515,12943,13171,13929,10720,11606,11404,12197,11811,12338,12605,13145,12020,12716,12375,13006,12478,13373,13262,13803,11474,12566,12852,13327,12758,13232,13612,13792,12973,13528,13417,14070,13729,13965,14199,15074,9164,10020,10368,11141,10564,11254,11630,12214,10764,11868,11335,12321,11521,12080,12530,13139,10270,11442,11599,12476,11826,12799,12372,13111,12063,12629,12740,13358,12246,13543,13260,14500,11009,11645,11998,12934,12229,12658,12601,13496,11810,12784,13041,13314,12961,13400,13661,13975,12445,12989,12842,13431,13144,13821,13581,14093,13263,13692,13932,14237,13805,14168,14585,14749,11156,12031,12301,12767,11869,13159,12881,13520,12503,12942,13335,13646,13040,13728,13936,14324,12176,13233,13131,13767,13365,13972,13807,14300,13540,13912,14118,14233,14069,14625,14506,14894,12631,13459,13298,13963,13655,14388,13914,14447,13167,14132,14049,14534,14082,14605,14711,15501,13419,14327,14239,14782,14197,14692,14844,15148,14429,14819,14739,15241,14931,15653,15172,15821,7527,7987,8370,9261,8626,9381,9621,10458,8794,9987,9555,10828,9802,10540,10996,11626,8962,9681,10129,10660,9925,11251,10788,11791,10281,11114,11405,12362,11041,11857,12022,12812,9118,10094,9993,10942,10326,11097,11350,12052,10709,11565,11199,11932,11504,12185,12497,13005,10521,11440,11309,12150,11638,12424,12278,12955,11825,12477,12628,13685,12704,13308,13170,13962,9418,10190,10620,11250,10941,11378,11994,12245,10397,11458,11700,12364,11522,12587,12401,13132,10894,11808,11859,12797,11604,12496,12718,13334,12209,12821,12565,13235,12986,13418,13571,14155,11228,11958,12300,12637,12094,12935,12803,13487,12430,13156,13007,13401,12796,13613,13695,14116,12049,13189,13128,13647,13359,13913,13800,14301,12975,13785,13952,14617,14068,14505,14408,15007,9841,10997,10538,11637,10760,12274,11567,12705,11294,11790,12055,12647,12012,12546,12898,13505,11212,12446,12149,13082,11957,12815,12787,13621,12374,12977,13257,13429,13147,13730,13814,14257,11494,12231,12512,12952,12607,13326,13136,13930,12255,13110,13470,13802,13234,13693,14027,14389,12706,13402,13325,13823,13623,14134,13954,14489,13569,14054,14266,14532,14196,14632,14708,15259,11821,12756,12402,13297,12545,13168,13456,13966,12813,13722,13374,13935,13523,14081,14119,14586,12974,13652,13497,14169,13822,14100,14325,14892,13786,14411,14216,14624,14390,14738,14841,15090,13130,13507,13915,14256,13694,14302,14446,14729,14051,14604,14374,14818,14533,14847,14973,15215,13964,14490,14606,15075,14710,14920,14986,15385,14402,15061,15150,15326,15173,15427,15568,15882,10286,11113,10937,12101,11390,12267,12029,12883,11534,11918,12564,13332,12425,12988,13187,13787,11641,12486,12349,13108,12785,13580,13157,13849,12671,13261,13403,14080,13506,13953,14217,14616,11995,12800,12630,13299,12960,13372,13428,13967,12498,13486,13660,14232,13806,14153,14102,14635,13118,13663,13928,14095,13793,14267,14391,14780,13620,14430,14258,14731,14524,14865,14930,15305,12228,12602,13138,13654,12899,13541,13843,14235,13324,14025,13731,14154,13274,14326,14403,14817,13390,13812,13933,14619,14050,14375,14502,15082,14133,14602,14431,14846,14695,14921,15072,15329,13529,13938,14236,14503,14071,14736,14603,14975,14351,14535,14781,15005,14627,15213,15088,15424,14171,14730,14845,15091,14922,15256,15174,15509,14840,15161,15327,15585,15304,15447,15641,15929,12646,13004,13188,13820,13484,14117,13801,14428,13367,13955,13937,14587,14092,14634,14525,15063,13644,14265,14055,14504,14373,14607,14783,15004,14234,14737,14843,15089,14709,15162,15243,15508,13766,14152,14488,14693,14303,14864,14748,15151,14401,14816,14895,15331,15060,15175,15214,15584,14601,14985,15081,15242,14972,15425,15306,15570,14866,15325,15446,15697,15387,15640,15655,15967,13974,14410,14507,14984,14694,14842,15080,15257,14618,14893,15006,15307,15149,15444,15384,15643,14751,15073,15160,15426,15212,15328,15503,15737,15240,15511,15500,15654,15571,15699,15739,16122,14923,15163,15258,15502,15324,15510,15587,15698,15386,15586,15569,15822,15652,15823,1573 8,15966,15445,15642,15696,15880,15736,15881,15883,15931,15820,15928,15930,15965,15964,16123,16120,1612
1,2780,2781,2782,3491,2783,3636,3639,4444,3488,3638,3813,4616,4024,4637,4639,5693,3489,3812,3814,4636,40
27,4774,5027,5717,4310,5026,4846,5912,5253,5968,6070,6868,3490,4025,4309,4844,4311,5025,5059,5914,4617,5
211,5255,5969,5564,6142,6280,7086,4638,5365,5567,6178,5716,6343,6503,7133,5779,6545,6660,7425,6725,7486,
7748,8541,3637,4026,4446,5210,4618,5254,5507,6085,4772,5692,5366,6281,5776,6371,6606,7250,5024,5566,577
8,6544,5932,6657,6724,7469,6068,6727,6870,7664,7084,7832,7943,8816,5209,5913,5970,6663,6143,6842,6946,77
65,6341,6947,7132,7887,7298,8057,8153,9025,6547,7248,7442,8075,7484,8156,8341,9178,7689,8349,8531,9311,8
644,9460,9647,10547,3815,4445,4619,5565,4775,5695,5718,6605,5056,5777,5933,6662,6069,6840,6861,7750,525
2,5934,6071,6843,6179,6945,7129,7914,6370,7130,7249,8024,7468,8138,8292,9125,5500,6140,6342,7071,6492,71
31,7317,8085,6661,7440,7485,8158,7688,8347,8513,9310,6860,7578,7766,8373,7912,8565,8646,9427,8059,8760,8
934,9570,9079,9736,10034,10577,5505,6368,6656,7336,6787,7471,7667,8351,6869,7690,7835,8540,7956,8645,87
87,9511,7095,7915,8025,8729,8157,8878,9057,9766,8282,9098,9195,9938,9347,10120,10194,11007,7316,8086,82
64,8950,8374,9124,9235,9975,8593,9283,9428,10168,9576,10198,10462,11272,8785,9482,9676,10329,9711,10509 ,10633,11425,10017,10705,10799,11396,10899,11581,11787,12526,4308,4773,4845,5915,5057,5935,6086,6944,50
58,6087,6282,7087,6500,7251,7337,8284,5367,6283,6501,7350,6658,7443,7576,8285,6726,7539,7749,8530,7940,8
592,8720,9426,5503,6607,6784,7424,6929,7579,7767,8566,7069,7839,7957,8722,8056,8867,8982,9708,7068,8026,
8136,8866,8281,9076,9127,9939,8486,9257,9348,10071,9480,10192,10346,11193,5694,6863,6930,7837,7094,7994 ,8087,8817,7134,8152,8190,9027,8342,9176,9269,10069,7691,8293,8375,9193,8542,9345,9473,10170,8763,9502,9
690,10310,9785,10498,10656,11366,7993,8537,8723,9375,8835,9569,9706,10480,9007,9750,9862,10546,10035,10
736,10838,11515,9232,10019,10121,10824,10171,10913,10746,11617,10417,11137,11273,11814,11285,12091,122
27,12665,5719,7092,7128,8280,7640,8346,8512,9256,7838,8529,8543,9372,8762,9508,9689,10482,7958,8730,883
4,9509,8948,9707,9793,10580,9099,9899,9974,10718,10169,10835,10995,11657,8283,8876,8981,9792,9126,9961,
10133,10778,9350,10144,10196,10979,10418,10891,11227,11852,9535,10294,10492,11145,10581,11284,11383,11
982,10737,11399,11398,12167,11619,12283,12379,12944,8536,9096,9258,10145,9503,10197,10345,11055,9691,1
0481,10511,11274,10686,11305,11397,12085,9844,10617,10784,11367,10846,11415,11633,12285,11047,11678,11
779,12409,11914,12577,12662,13229,10070,10832,10961,11635,11225,11660,11898,12472,11270,11862,12000,12
609,12126,12725,12902,13466,11307,12112,12269,12777,12326,12920,12826,13519,12521,13045,13112,13718,13
284,13796,13959,14275,4447,4847,5208,5971,5364,6340,6502,7318,5502,6546,6659,7349,6786,7537,7577,8558,5
504,6785,6862,7536,6931,7995,8072,8784,7156,8074,8267,9024,8344,9137,9259,10162,5506,6928,7093,8027,715
8,8265,8294,9110,7319,8350,8514,9308,8564,9461,9532,10220,7441,8538,8661,9500,8818,9688,9737,10436,8904,
9709,9909,10616,9936,10716,10833,11805,6141,7157,7299,8343,7351,8515,8559,9374,7665,8721,8768,9604,8907 ,9764,9898,10490,7836,8771,8980,9718,9109,9930,9949,10658,9192,9951,9972,10837,10292,10914,11103,11854,
7959,9108,9162,9966,9344,10123,10161,10859,9472,10279,10363,11046,10526,11194,11275,12009,9579,10461,1
0588,11281,10738,11362,11529,12137,10933,11568,11698,12304,11784,12443,12590,13222,6176,7339,7538,8647 ,7834,8769,8935,9784,7942,8983,9111,9960,9233,10001,10057,10856,8139,9163,9341,10059,9463,10262,10331,1
1034,9577,10422,10524,11266,10659,11312,11471,12018,8295,9373,9531,10347,9738,10493,10491,11315,9845,1
0632,10706,11426,10865,11549,11589,12309,10000,10739,10917,11582,11035,11737,11786,12480,11136,11838,1
1971,12610,12163,12755,12913,13483,8492,9646,9751,10634,9948,10727,10867,11569,10251,10932,11078,11771 ,11090,11800,11909,12561,10295,11088,11123,11867,11343,11970,12118,12722,11512,12160,12251,12780,12369,
12958,13066,13538,10423,11385,11460,12025,11602,12183,12282,12875,11699,12343,12483,13020,12591,13124,
13243,13749,11977,12489,12625,13153,12774,13318,13371,13917,12877,13421,13517,14003,13633,14140,14253, 14686,6493,7666,7886,9006,8137,9161,9309,10187,8188,9346,9483,10277,9605,10394,10579,11477,8372,9533,9767,10483,9911,10725,10681,11514,9962,10785,10898,11677,11074,11755,11812,12522,8819,9860,9963,10719,10250,10858,10962,11778,10276,11077,11101,11813,11224,11910,11981,12683,10304,11154,11288,11979,11510,12115,12239,12783,11584,12319,12368,12969,12488,13067,13201,13689,8906,10249,10261,11044,10309,11089,11265,11952,10460,11360,11445,12087,11550,12194,12340,12925,10916,11479,11616,12241,11715,12440,12491,13047,11915,12516,12640,13163,12776,13302,13355,13907,11100,11736,11866,12442,11978,12598,12698,13219,12124,12739,12806,13352,12921,13423,13536,14057,12280,12886,13008,13516,13107,13608,13688,14150,13226,13725,13781,14246,13870,14371,14392,14911,8951,10311,10393,11469,10857,11519,11588,12317,10993,11661,11759, 12463,11902,12537,12681,13205,11121,11806,11973,12581,12059,12701,12809,13345,12226,12918,12789,13407, 13050,13527,13632,14087,11513,11983,12114,12763,12307,12830,12971,13510,12405,13009,13106,13609,13197, 13637,13757,14223,12594,13143,13238,13705,13379,13824,13901,14319,13462,13988,14038,14454,14141,14528, 14550,14814,11732,12119,12382,13014,12527,13100,13150,13668,12663,13279,13322,13774,13409,13825,14007, 14386,12687,13387,13512,13984,13630,14062,14067,14546,13733,14156,14207,14583,14298,14696,14759,15069, 12928,13594,13610,14130,13770,14160,14248,14609,13866,14318,14356,14740,14469,14760,14935,15178,13945, 14443,14499,14854,14596,14869,14996,15261,14663,15018,15064,15334,15132,15390,15431,15648,6604,6177,5501,7941,6084,7751,7070,9234,6369,7085,7159,8932,7348,8348,8159,9568,6841,7338,7487,8266,7764,8728,8528,9967,8058,8556,8786,9429,9026,10263,9748,10845,6871,7641,7833,8567,8073,8761,9077,9677,8189,9177,8879,10576,9351,9861,10018,11801,8345,9097,9501,9931,9282,10160,10441,11319,9606,10392,10260,10978,10657,11478,11091,12482,7135,7992,8084,8949,8340,9136,9425,10058,8539,9717,9179,10195,9534,10305,10508,11122,8731 ,9349,9929,10437,9749,10836,10362,11271,9510,10525,10912,11384,10724,11930,11580,13044,8905,9910,9607,10687,10199,10578,11032,11447,10016,11155,10798,11752,10963,11601,12318,12090,10328,11054,11245,12001,11318,11776,11853,12576,11461,12161,11955,12887,12305,13378,12723,13902,7470,8191,8493,9340,8660,9481,9716,10463,8877,10068,9571,10544,9863,10684,10864,11634,9056,9739,10221,10717,9973,11102,10825,11585,10308,10992,11289,11785,11195,11900,12121,12632,9194,10186,9937,10890,10510,11075,11313,11835,10440,11509,11120,12342,11427,11990,12019,12790,10704,11286,11676,12120,11551,12193,12464,13436,11815,12520,12312,12873,12680,13069,13200,14028,9462,10278,10589,11267,10416,11342,11591,12147,10747,11756,11444,12597 ,11855,12250,12459,12968,10915,11528,11901,12324,12086,12492,12782,13103,11679,12713,12536,13344,12884 ,13228,13518,14200,11079,11976,12127,12727,11770,12611,12819,13593,12281,12950,13097,13354,12664,13719 ,13467,14820,12378,13021,13162,13669,13231,13533,13636,14367,12912,13778,13871,14129,13958,14629,14252 ,15355,7913,8557,8770,9719,9078,10122,9908,10844,9160,9950,10494,11006,10248,11152,11304,11954,9424,10330,10163,11264,10499,11583,11094,12084,10726,11361,11632,12182,11468,12560,12441,13413,9578,10545,10395,11804,10960,11314,11476,12195,10685,11548,11733,12768,11863,12315,12493,13113,11045,11953,11777,12596,12136,12467,12775,13225,12017,12712,12846,13307,12967,13478,13691,14108,9765,11226,10635,11603,10834 ,11980,11754,12624,11095,11834,12097,12523,12192,12726,12876,13380,11382,12325,12024,13085,11911,12770, 12831,13639,12517,12947,13125,13500,13227,13575,13783,14423,11518,12408,12190,12903,12583,13046,13319, 13763,12754,13406,13099,13664,13196,13991,13896,14347,12284,13278,13532,13927,13422,13830,14174,14312, 13611,14138,14029,14576,14279,14483,14697,15418,10132,10866,11280,11931,11446,12058,12462,12924,11600, 12642,12125,13015,12313,12808,13230,13759,11144,12240,12383,13194,12608,13479,13096,13713,12807,13349, 13412,13970,12946,14151,13882,14934,11807,12481,12724, 13 566, 12927,13370,13303,14104,12582,13460,13681, 13916,13597,14010,14241,14521,13151,13641,13526,14039,13762,14379,14163,14591,13897,14254,14450,14735, 14357,14682,14997,15177,11972,12771,12983,13437,12643,13775,13537,14128,13223,13574,13951,14220,13680, 14278,14464,14794,12874,13831,13735,14297,13985,14498,14365,14778,14146,14398,14646,14721,14575,15055, 14962,15270,13351,14063,13904,14479,14227,14834,14416,14891,13779,14660,14551,14982,14582,15041,15129, 15729,14033,14799,14741,15192,14689,15116,15228,15468,14881,15203,15165,15553,15311,15885,15492,15985, 8487,8933,9268,10193,9530,10293,10495,11306,9710,10839,10419,11656,10680,11424,11792,12458,9928,10527, 11033,11508,10779,12045,11618,12551,11153,11908,12191,13068,11839,12633,12762,13502,10056,10994,10847, 11758,11244,11899,12146,12788,11511,12327,11991,12686,12308,12885,13207,13657,11363,12238,12113,12872, 12466,13114,12970,13595,12599,13195,13348,14249,13384,13906,13782,14478,10344,11076,11470,12044,11757, 12162,12720,12945,11287,12268,12490,13084,12314,13285,13101,13748,11714,12580,12641,13475,12404,13206, 13408,13950,12919,13513,13245,13855,13638,14032,14161,14677, 120 16, 12700, 12982, 13353, 12818, 13567, 1350 1, 14091,13142,13772,13665,14011,13474,14175,14263,14642,12781,13811,13732,14221,13971,14399,14320,14779, 13625,14299,14470,15047,14574,14959,14868,15365,10707,11793,11414,12465,11590,12966,12341,13385,12096, 12550,12791,13363,12738,13242,13558,14109,12008,13152,12847,13690,12699,13511,13463,14193,13098,13631, 13867,14035,13771,14282,14370,14753,12306,12929,13224,13592,13323,13926,13756,14442,12951,13712,14066, 14346,13854,14255,14547,14835,13386,14014,13921,14383,14201,14662,14472,14905,14157,14568,14766,14978, 14688,15068,15120,15593,12595,13420,13102,13903,13239,13780,14056,14492,13503,14274,14002,14455,14131, 14581,14647,15000,13624,14222,14105,14683,14382,14608,14795,15268,14304,14873,14698,15054,14848,15164, 15211,15460,13734,14115,14417,14752,14262,14790,14890,15133,14565,15040,14828,15202,14979,15237,15323, 15541,14482,14910,15044,15419,15128,15288,15354,15671,14862,15375,15470,15630,15493,15715,15790,16040, 11192,11903,11753,12827,12166,12959,12769,13539,12316,12682,13244,13944,13115,13640,13797,14305,12473, 13204,13051,13704,13461,14162,13773,14393,13381,13883,14015,14580,14114,14471,14699,15046,12721,13482, 13350,13905,13596,13990,14034,14493,13218,14090,14240,14720,14364,14673,14628,15101,13724,14247,14422, 14597,14313,14767,14849,15186,14192,14884,14758,15135,14966,15251,15310,15605,12926,13306,13758,14226, 13559,14147,14387,14733,13920,14529,14283,14676,13900,14798,14863,15199,14006,14366,14451,15051,14564, 14829,14946,15430,14661,15036,14885,15236,15119,15289,15412,15645,14139,14468,14734,14947,14577,15138, 15037,15335,14815,14983,15187,15361,15065,15531,15434,15686,14687,15134,15229,15461,15292,15574,15522, 15765,15210,15485,15631,15813,15604,15725,15847,16061,13362,13656,13810,14378,14086,14643,14321,14880, 13989,14473,14465,15001,14590,15100,14967,15391,14206,14761,14569,14958,14821,15045,15193,15360,14732, 15139,15219,15435,15121,15488,15559,15764,14296,14672,14904,15117,14791,15250,15176,15471,14855,15198, 15271,15649,15374,15523,15540,15812,15019,15347,15421,15558,15322,15687,15606,15804,15260,15617,15724, 15915,15677,15846,15905,16157,14520,14872,14963,15346,15118,15218,15420,15575,15050,15269,15364,15607, 15469,15720,15670,15849,15179,15413,15484,15714,15530,15644,15759,15947,15552,15771,15728,15904,15805, 15943,15977,16252,15293,15489,15592,15758,15616,15770,15837,15942,15676,15836,15791,16012,15884,16013, 15976,16156,15721,15848,15914,16018,15946,16019,16041,16103,15984,16060,16102,16133,16132,16253,16174, 16175,6494,6495,7296,7643,7297,7884,8155,8864,7426,8154,8287,9058,8494,9271,9281,10307,7427,8286,8484,9 270,8595,9430,9679,10421,8832,9678,9528,10496,9897,10644,10744,11524,7642,8495,8663,9474,8833,9645,9787 ,10582,9059,9847,9965,10645,10264,10826, 10918,11696,9280,10003,10267,10896,10420,11005, 11147,11739,104 89,11205,11316,11989,11365,12088,12236,12901,7885,8594,9004,9846,9138,9964,10223,10777,9342,10306,1003 2,10919,10442,11073,11268,11836,9644,10266,10488,11204,10590,11283,11364,12027,10682,11381,11526,12164, 11662,12286,12381,13070,9795,10497,10646,11341,10827,11430,11574,12249,10977,11575,11738,12345,11860,12475,12563,13217,11207,11832,12010,12525,12056,12578,12711,13346,12189,12761,12849,13433,12948,13552,13659,14261,8485,8865,9139,10265,9431,10361,10438,11247,9704,10443,10591,11340,10683,11428,11463,12242,9896,10618,10745,11431,10897,11573,11719,12370,11072,11734,11833,12456,12026,12548,12702,13301,10134,10796,11004,11659,11092,11735,11865,12533,11317,12002,12057,12588,12188,12753,12825,13432,11462,12138,12270,12779,12346,12931,12956,13525,12495,13012,13160,13628,13247,13726,13918,14269,10185,11052,11282,11912,11413,12047,12181,12773,11525,12224,12297,12900,12406,12949,13065,13579,11717,12371,12457,13003,12579,13126,13237,13754,12684,13280,13369,13844,13465,13946,14004,14495,11864,12534,12634,13174,12804,13300,13383,13887,12939,13425,13534,13980,13634,14012,14186,14636,13055,13562,13666,14099,13711,14229,14285,14725,13909,14323,14395,14716,14457,14823,14933,15286,8662,9343,9475,10583,9705,10619,10786,11572 ,9786,10787,10934,11697,11138,11837,11913,12696,10033,10935,11139,11974,11290,12011,12122,12697,11380,12117,12237,12848,12376,12938,12980,13524,10147,11269,11386,11988,11531,12139,12271,12936,11587,12311,12407,13000,12474,13121,13198,13708,11586,12460,12538,13120,12667,13240,13305,13845,12810,13405,13472,13943,13560,14000,14112,14595,10360,11517,11570,12299,11716,12422,12535,13071,11768,12562,12626,13221,12714,13330,13415,13941,12225,12703,12805,13361,12914,13439,13557,13982,13023,13572,13682,14096,13761,14224,14306,14706,12421,12851,13001,13509,13105,13627,13706,14188,13203,13750,13790,14260,13919,14362,14414,14789,13376,13911,13947,14396,13983,14459,14376,14851,14149,14573,14637,14956,14645,15085,15147,15345,10439,11712,11718,12666,12144,12752,12824,13404,12310,12845,12915,13480,13022,13576,13671,14190,12410,13010,13104,13577,13172,13707,13769,14272,13281,13799,13886,14354,13981,14407,14487,14861,12685,13122,13193,13768,13304,13865,13957,14380,13476,13968,14008,14481,14158,14453,14613,14968,13619,14078,14202,14579,14273,14644,14713,15034,14363,14719,14718,15131,14853,15169,15221,15480,12850,13276,13410,13969,13573,14009,14111,14531,13683,14189,14231,14638,14316,14675,14717,15077,13776,14281,14384,14707,14420,14723,14857,15171,14523,14876,14925,15227,15002,15299,15342,15601,13942,14404,14475,14859,14611,14870,14988,15248,14630,14976,15042,15319,15112,15371,15452,15684,14679,15092,15159,15403,15204,15458,15428,15709,15283,15517,15554,15780,15618,15814,15869,15979,9005,9529,9794,10647,10002,10976,11146,11896,10146,11206,11291,11969,11412,12099,12123,12922,10184,11387,11516,12098,11571,12423,12518,13054,11794,12524,12661,13216,12736,13317,13411,13978,10222,11530,11713,12461,11802,12635,12708,13286,11897,12772,12828,13426,12930,13553,13616,14030,12003,12878,12965,13564,13086,13670,13727,14166,13140,13709,13809,14280,13828,14352,14405,14951,10797,11795,11861,12715,11975,12829,12923,13508,12165,12981,13048,13648,13149,13752,13798,14194,12298,13053,13192,13716,13283,13826,13847,14308,13360,13853,13884,14413,14076,14460,14563,14970,12411,13282,13328,13880,13438,13949,13977,14427,13556,14075,14137,14522,14244,14598,14639,15049,13643,14185,14276,14641,14368,14704,14797,15115,14467,14812,14878,15180,14926,15233,15308,15594,10888,11929,12116,12957,12296,13049,13161,13760,12380,13199,13287,13864,13377,13899,13923,14424,12549,13329,13435,13925,13555,14064,14107,14508,13635,14164,14242,14622,14309,14680,14757,15056,12709,13481,13599,14113,13744,14203,14195,14685,13777,14284,14344,14726,14441,14809,14831,15185,13898,14369,14463,14824,14509,14889,14932,15252,14572,14964,15015,15320,15127,15393,15455,15693,12816,13658,13751,14286,13846,14361,14449,14813,14059,14466,14540,14907,14544,14948,14995,15297,14079,14542,14571,14981,14701,15014,15096,15368,14786,15124,15157,15404,15217,15490,15524,15718,14165,14715,14746,15059,14838,15137,15168,15441,14879,15209,15255,15514,15309,15560,15611,15789,15021,15263,15333,15567,15400,1562 4,15651,15851,15443,15673,15707,15879,15751,15926,15971,16094,11093,12180,12344,13202,12539,13321,13427,13987,12592,13464,13563,14073,13649,14144,14271,14763,12778,13617,13755,14191,13817,14359,14311,14788,13868,14385,14456,14875,14536,14899,14954,15284,13087,13788,13869,14355,14058,14426,14476,14924,14072,14539,14561,14955,14610,14998,15033,15351,14084,14592,14658,15023,14784,15095,15153,15407,14826,15197,15216,15497,15262,15525,15581,15773,13148,14037,14061,14510,14089,14543,14621,15010,14184,14702,14743,15079,14810,15144,15206,15463,14462,14765,14850,15155,14883,15230,15265,15519,15003,15280,15338,15573,15402,15620,15639,15845,14560,14888,14980,15232,15022,15316,15356,15591,15102,15389,15414,15636,15459,15675,15716,15901,15166,15450,15506,15706,15543,15742,15772,15934,15598,15783,15809,15962,15830,16007,16016,16163,13175,14097,14143,14755,14425,14793,14830,15195,14485,14871,14903,15239,14992,15291,15349,15583,14567,14952,15017,15301,15071,15359,15417,15629,15146,15456,15409,15665,15520,15711,15750,15909,14787,15035,15094,15395,15183,15432,15499,15702,15225,15507,15542,15743,15579,15753,15793,15957,15312,15563,15608,15777,15657,15818,15839,15995,15682,15874,15898,16030,15927,16052,16056,16134,14886,15097,15222,15512,15287,15536,15564,15766,15343,15615,15626,15802,15667,15819,15887,16014,15353,15663,15704,15872,15748,15902,15907,16054,15785,15936,15953,16071,15988,16098,16115,16201,15466,15734,15744,15922,15798,15938,15968,16077,15828,15994,16000,16110,16035,16116,16165,16222,15865,16027,16049,16144,16074,16149,16180,16243,16087,16184,16198,16258,16212,16270,16279,16318,11246,10889,10135,12377,10776,12243,11658,13382,11053,11663,11803,13154,11968,12760,12589,13626,11429,11928,12089,12660,12248,13002,12844,13881,12494,12916,13064,13535,13220,14065,13746,14419,11527,12145,12287,12937,12519,13013,13241,13667,12593,13331,13127,14268,13477,13789,13910,14949,12737,13277,13565,13827,13424,13976,14173,14691,13650,14142,14060,14480,14307,14764,14545,15254,11769,12420,12532,13173,12710,13316,13515,13924,12879,13715,13347,14005,13618,14085,14228,14570,13011,13473,13819,14167,13747,14412,14136,14631,13578,14243,14458,14714,14358,15008,14822,15516,13141,13816,13651,14317,14013,14270,14496,14745,13908,14593,14394,14896,14477,14837,15196,15084,14098,14530,14615,15043,14690,14908,14969,15298,14747,15125,15013,15451,15181,15656,15369,15840,12046,12627,12817,13434,12964,13561,13714,14187,13123,13940,13629,14250,13791,14314,14440,14858,13236,13745,14031,14353,13885,14562,14397,14827,14088,14484,14659,14927,14599,14990,15099,15336,13368,13986,13829,14452,14230,14537,14681,14961,14172,14777,14566,15208,14727,15038,15057,15410,14322,14656,14874,15098,14811,15143,15244,15678,14957,15282,15188,15439,15348,15527,15580,15892,13554,14074,14277,14623,14148,14700,14833,15123,14377,14900,14742,15315,14971,15156,15235,15496,14461,14796,14991,15200,15078,15266,15406,15539,14877,15363,15290,15628,15448,15600,15708,15950,14541,15020,15113,15373,14906,15321,15423,15733,15167,15486,15533,15638,15344,15781,15685,16136,15220,15515,15572,15767,15603,15713,15752,16005,15454,15806,15831,15921,15868,16079,15970,16263,12347,12917,13052,13717,13246,13948,13808,14418,13320,13852,14204,14494,14036,14588,14674,15012,13514,14106,13979,14620,14225,14825,14548,15076,14360,14703,14856,15136,14754,15296,15231,15669,13642,14251,14145,14950,14474,14684,14762,15145,14315,14808,14887,15396,14977,15191,15267,15555,14511,15011,14909,15314,15114,15247,15401,15597,15053,15362,15436,15623,15495,15690,15775,15916,13753,14612,14287,14839,14406,15032,14898,15332,14549,14960,15087,15285,15142,15372,15442,15658,14712,15201,15058,15529,14999,15398,15433,15755,15281,15483,15561,15694,15599,15731,15811,16025,14792,15226,15140,15453,15303,15518,15625,15797,15392,15664,15535,15762,15578,15877,15834,15999,15170,15614,15712,15855,15674,15824,15944,15992,15745,15924,15893,16066,15981,16045,16099,16274,13956,14448,14640,15009,14744,15070,15238,15462,14836,15340,15103,15

51315189,15416,15602,15795,14578,15154,15223,15576,15318,15691,15532,15779,15415,15633,15668,15870,15482,15935,15832,16164,14953,15253,15370,15726,15465,15650,15621,15912,15302,15680,15769,15850,15741,15888,15961,16051,15565,15757,15710,15899,15796,16009,15941,16073,15835,15972,16028,16109,16001,16092,16181,16221,15016,15399,15505,15679,15341,15803,15717,15920,15595,15730,15867,15954,15768,15980,16032,16128,15440,15825,15787,15987,15873,16048,16003,16124,15932,16020,16082,16105,16065,16197,16170,16246,15635,15903,15842,16043,15959,16140,16022,16159,15807,16084,16057,16178,16070,16189,16211,16333,15895,16131,16111,16226,16097,16204,16236,16284,16153,16231,16219,16301,16255,16353,16292,16365,12811,13155,13414,14001,13598,14077,14205,14678,13710,14415,14159,14860,14310,14724,14944,15234,13818,14245,14497,14776,14381,15067,14852,15295,14589,14994,15141,15526,14965,15337,15394,15700,13922,14486,14421,14902,14614,14989,15122,15408,14785,15205,15039,15352,15184,15449,15589,15761,14705,15152,15093,15438,15246,15556,15498,15735,15317,15577,15632,15969,15660,15844,15810,16042,14110,14538,14756,15066,14901,15126,15366,15481,14657,15158,15264,15528,15190,15619,15537,15788,14882,15300,15339,15689,15224,15588,15666,15866,15457,15705,15613,15827,15754,15894,15939,16091,15052,15358,15504,15637,15422,15727,15695,15911,15562,15800,15763,15889,15688,15945,15975,16080,15405,15817,15784,15955,15871,16021,15996,16125,15747,15989,16036,16193,16064,16169,16148,16267,14345,14945,14722,15245,14832,15494,15207,15661,15086,15294,15411,15647,15388,15610,15722,15917,15048,15566,15437,15774,15357,15703,15683,15949,15534,15749,15829,15897,15799,15982,16006,16113,15182,15467,15596,15732,15627,15854,15792,16026,15487,15778,15906,15998,15826,15973,16055,16141,15662,15890,15853,16011,15951,16086,16038,16161,15937,16062,16118,16176,16096,16200,16208,16307,15313,15672,15538,15841,15609,15808,15900,16046,15701,15978,15878,16031,15923,16069,16083,16182,15746,15956,15913,16093,16010,16076,16129,16244,15990,16151,16100,16196,16142,16218,16233,16282,15786,15919,16023,16112,15974,16126,16158,16213,16059,16188,16138,16230,16177,16239,16257,16299,16044,16162,16190,16275,16210,16248,16262,16321,16146,16269,16286,16314,16293,16327,16340,16370,14594,14993,14897,15429,15130,15491,15397,15719,15194,15350,15612,15864,15557,15756,15815,15991,15249,15582,15521,15776,15681,15940,15801,16017,15659,15833,15891,16068,15918,16037,16101,16192,15367,15692,15634,15843,15740,15876,15896,16047,15590,15910,15960,16104,16002,16089,16078,16203,15782,15963,16024,16075,15993,16119,16143,16224,15948,16154,16114,16215,16172,16241,16254,16309,15464,15622,15794,15958,15723,15933,16015,16107,15852,16053,15983,16090,15838,16130,16147,16229,15886,16004,16029,16195,16058,16139,16166,16278,16085,16186,16155,16238,16207,16249,16272,16317,15925,16034,16108,16167,16067,16216,16187,16259,16135,16179,16225,16265,16199,16297,16280,16324,16095,16214,16237,16283,16250,16304,16294,16337,16232,16289,16315,16345,16308,16331,16349,16373,15646,15760,15816,16008,15908,16081,15997,16152,15875,16039,16033,16183,16072,16202,16173,16271,15952,16117,16063,16168,16137,16191,16227,16264,16106,16217,16235,16281,16209,16290,16303,16336,15986,16088,16160,16205,16127,16240,16220,16287,16145,16228,16247,16319,16268,16295,16298,16344,16185,16261,16277,16302,16256,16325,16310,16342,16242,16313,16330,16357,16323,16348,16355,16379,16050,16150,16171,16260,16206,16234,16276,16305,16194,16245,16266,16311,16285,16328,16320,16351,16223,16273,16288,16326,16296,16316,16335,16361,16300,16339,16332,16354,16343,16359,16363,16382,16251,16291,16306,16334,16312,16338,16347,16358,16322,16346,16341,16366,16352,16367,16362,16378,16329,16350,16356,16368,16360,16369,16371,16375,16364,16372,16374,16377,16376,16383,16380,16381]

**Sequence group 7: Q7_2048**

[0,1,2,4,8,16,32,3,5,64,9,6,17,10,18,128,12,33,65,20,256,34,24,36,7,129,66,512,11,40,68,130,19,1

3,48,1
4,72,257,21,132,35,258,26,513,80,37,25,22,136,260,2
64,38,514,96,67,41,144,28,69,42,516,49,74,272,160,1
026,520 ,288,528,192,544,70,44,131,81,50,73,15,320,
133,52,23,134,384,76,137,82,56,27,97,39,259,84,138,
145,261,29,43,9
8,515,88,140,30,146,1028,71,262,265,161,576,45,100
,640,1025,51,148,46,75,266,273,517,104,162,53,193,
1032,15
2,77,164,768,268,274,518,54,83,57,521,112,1024,135
,78,289,194,85,276,522,58,168,139,99,86,60,280,89,2
90,529,
524,196,141,1040,101,147,176,142,530,321,31,200,9
0,1056,545,292,322,532,263,149,102,105,304,296,10
30,163,9
2,1033,47,267,385,546,324,208,386,150,153,165,106,
55,328,1088,536,577,548,1034,113,154,79,269,108,5
78,224,1
66,519,552,195,270,1041,641,1036,523,275,580,291,
59,169,560,114,277,156,87,1152,197,116,170,61,104
2,531,52
5,642,281,278,526,177,293,388,1057,91,584,769,198,
172,120,201,336,62,282,143,1029,1044,103,178,294,
93,1058,
644,202,592,323,392,297,770,107,180,1280,151,209,
284,1027,648,94,204,298,400,608,1089,352,325,533,
155,210,
305,547,300,109,1048,184,534,1060,537,115,1090,16
7,225,326,306,772,157,656,329,110,117,212,171,103
8,776,10
64,330,1153,226,549,1043,538,387,308,216,416,271,
279,158,337,550,672,1092,118,332,579,540,1072,389
,173,103
7,121,553,199,784,179,228,338,312,1536,704,1154,3
90,174,554,581,1046,393,283,122,448,353,561,1096,
203,63,3
40,394,1049,1281,527,582,556,181,295,1059,285,232
,124,205,182,643,1156,562,286,585,299,354,1045,21
1,401,11
04,185,1061,396,344,586,645,1282,593,535,240,1050
,206,95,327,564,800,402,356,307,301,417,1160,213,1
066,568 ,1120,832,588,1035,1537,186,646,404,1091,
227,896,594,418,302,649,771,360,539,111,1052,331,
1168,214,309,106
2,1284,188,449,1073,217,408,609,596,551,650,229,1
59,420,310,1093,541,1288,773,610,657,333,1065,119
,1098,60
0,339,1184,218,368,652,1031,230,391,313,450,542,1
538,334,1076,233,555,774,175,123,1155,658,612,341
,777,220 ,314,1105,424,1068,395,673,583,355,1296,1
094,287,183,234,1051,125,557,1216,660,616,342,316
,1157,241,778,56
3,1074,345,452,397,403,1112,207,1540,674,558,785,
1100,432,1039,357,187,1162,236,664,1312,624,587,7
80,1080,
1122,705,126,242,1063,565,398,346,456,358,405,303
,569,1544,244,1158,1097,595,1283,189,566,676,1169
,1054,1
108,361,706,589,1344,215,786,647,348,419,406,464,
680,801,1069,362,1164,590,409,1286,570,1121,788,1
552,110
6,597,1075,572,1186,219,311,708,598,1289,601,651,
421,792,802,611,1047,602,1172,410,231,688,653,112
8,248,10
70,369,190,364,1568,654,1095,659,1161,335,480,315
,221,370,1285,613,1408,422,425,451,1077,614,543,1
298,235,
412,343,372,1185,775,317,1539,222,1099,426,453,23
7,1124,559,1170,1292,833,804,712,1082,834,661,105
3,808,7
79,1217,617,604,1541,433,720,816,1101,1176,836,34
7,897,1136,243,1297,662,1600,454,318,675,1110,618
,1081,8
98,781,1314,1220,376,428,1546,665,736,567,1107,11
92,1078,840,625,238,1159,359,457,399,787,591,678,
434,677,
1290,1542,349,1300,1102,245,1188,458,666,1113,62
0,1553,1163,1313,363,127,1067,191,1125,782,407,43
6,626,12
18,571,465,681,246,707,1346,350,1084,599,668,1548
,790,1165,1320,460,1123,1200,249,682,1664,573,117
1,411,8
03,1116,789,1304,709,365,440,628,689,374,1224,423
,1556,466,793,1130,250,371,1174,481,574,1348,413,
1109,60
3,366,1545,1287,1055,468,1570,655,900,805,615,116
6,684,1409,710,1187,429,794,252,1114,373,605,1232
,848,69
0,713,632,1316,482,806,1132,1083,427,1177,904,156
9,414,1291,223,1126,1554,663,692,835,1328,619,472
,1137,4
55,796,1189,1601,809,714,1248,721,837,716,1086,13
02,1352,864,810,1173,606,1194,912,1103,722,696,37
7,1424,
435,1293,1560,817,1129,1792,319,621,1180,812,484,
1345,430,1572,1138,1299,838,667,1219,488,1111,23
9,378,45
9,622,1410,627,437,380,1201,1608,818,1178,1294,46
1,1543,496,669,1190,1317,679,1140,1079,1221,724,8
41,1305 ,629,1584,351,467,1360,438,1115,737,251,4
62,442,441,1666,469,1549,247,683,1196,1226,842,14
12,1127,738,114
4,1308,899,1602,670,1318,783,1085,849,1555,1193,8
20,1576,728,928,791,367,1376,901,1233,630,1321,68
5,844,1
204,633,711,1118,253,691,1301,824,1175,902,686,16
68,1222,1416,1133,740,1347,850,375,1558,444,1306,
470,116
7,483,1547,415,485,905,1202,795,473,1240,634,744,
1616,852,960,1322,865,693,1131,1794,1350,797,122
5,1604,1
571,906,1252,715,1141,1330,807,474,636,1179,694,2
54,1550,1665,717,1071,1315,575,913,1440,798,811,3
79,1208 ,1353,1191,697,1564,431,1142,607,1228,489
,1324,866,723,486,1573,1181,1234,908,1793,1561,71
8,813,1364,476,

856,1117,1411,839,1329,1295,1146,725,698,1472,91
4,1249,752,868,819,1349,814,439,929,1197,1578,490
,1139,16
80,623,1632,1336,671,1198,1362,739,1603,1557,141
3,916,1303,463,1236,843,1135,381,1672,1354,497,15
86,930,8
21,726,961,1203,1182,872,1418,492,1250,1332,631,1
574,1223,729,1145,1605,700,1796,443,1307,741,137
8,1562,1
356,1205,845,1319,920,382,1585,822,1425,851,1229,
730,1609,498,880,1256,742,445,1392,471,635,1148,1
696,932 ,1580,687,1210,1420,1612,1325,1800,903,11
34,825,1235,1361,500,1577,846,1670,1195,745,826,7
32,1264,446,962 ,1426,1620,936,1377,475,853,1310,
867,637,1551,1230,1414,907,1206,1667,1588,1333,4
87,1808,695,1441,1087,74
6,828,753,1610,854,1237,1326,857,1368,1209,504,79
9,1355,255,964,1242,909,1673,1559,1309,719,1143,4
77,1617 ,915,1448,1380,638,748,944,1728,1331,1227
,869,1592,1428,491,699,1253,1351,754,1183,1565,85
8,1618,1417,147
6,478,968,1260,383,1212,910,1801,815,1579,976,870
,1684,1633,917,1337,1241,1606,1824,727,1150,1442,
493,135
7,1251,1676,873,1384,701,1566,931,1323,1798,1365,
1473,756,1334,860,499,731,1648,1238,823,1575,922,
1199,16
74,874,1432,1421,918,1636,1254,502,1795,933,1366,
1338,1682,1587,1211,1488,743,1358,760,1244,1581,
881,114
7,494,1379,1272,702,921,1624,501,876,1415,847,185
6,1444,992,1697,447,1607,1436,1369,1257,1704,733,
1797,16
69,1340,1231,827,1590,934,1634,1474,882,937,963,1
419,747,1265,1119,505,1381,855,924,1810,734,829,1
563,121
3,1611,1363,1430,1258,1688,1386,965,1614,1730,12
39,938,884,506,1327,1589,1804,749,1370,1640,945,9
66,1456,
1681,755,1266,859,1427,1593,1388,940,1214,830,18
09,911,1621,1582,1832,871,639,1480,1698,1335,888,
1372,12
45,479,1422,1268,946,1732,1677,750,1802,1626,139
3,969,508,1613,861,1446,1857,1339,757,1382,970,17
00,1243,
919,1594,1433,1826,1504,875,1635,1259,862,1920,1
675,1445,758,1149,948,1359,1816,1596,1671,1712,9
77,1385,
923,1622,972,1434,1311,1729,761,1396,877,1207,14
75,1449,1812,952,1686,495,1262,1644,1619,1341,14
29,1825,
703,1371,1638,1567,1736,935,1685,978,1625,883,76
2,1246,503,1458,925,1394,1269,878,1478,735,1799,1
678,186
0,1443,1637,1481,1373,1699,1255,993,1591,1828,14
52,885,939,994,1400,1744,1656,980,1689,926,764,12
70,941,1
628,1367,1805,1457,1921,1583,1387,1642,967,1267,
1484,1450,886,831,1683,1342,1811,947,1705,1431,5
07,1261,
1840,889,1650,984,1760,1490,1615,751,1702,942,18
58,1423,1460,1383,996,1692,1641,1814,971,1477,12
73,1512,
1733,890,1598,1374,509,1806,1922,1649,949,973,13
97,1489,1708,1627,1000,1690,892,1274,1438,1817,1
390,1464 ,1868,950,1151,1731,1506,1827,1597,863,1
451,759,1864,1714,1701,1395,1803,1008,1623,1482,
1276,510,1435,16
52,979,1492,953,1928,1829,1389,1738,763,1872,974,
1453,1643,1713,1818,1215,1402,1629,1520,1830,169
1,954,1
459,1734,879,981,1505,1706,982,1924,927,1833,163
9,1447,1746,1343,1679,1820,1761,1479,1275,995,17
40,1401,
1888,765,956,1496,1861,887,1437,985,1720,997,163
0,1813,1462,1398,1645,1848,1687,1247,1716,1936,9
86,1483,
1651,1745,943,1859,1508,1834,1454,891,1841,998,1
595,1278,766,1465,1709,1764,1646,1737,511,1485,1
404,1693 ,1866,1952,1491,988,1657,1752,1807,1399,
1844,1001,951,1654,1926,1707,1391,1002,1468,1836
,1494,1873,1271,
1694,893,1923,1461,1748,1715,975,1862,894,1815,1
497,1653,1510,1762,1842,1375,1703,1009,1466,1874
,955,173
9,1486,1930,1889,1004,1658,1821,1718,1929,1599,1
507,1776,1405,1735,1831,1493,1010,1984,1455,957,
1865,983 ,1710,958,1514,1876,1768,1721,1938,1660,
1500,1403,1892,1819,1741,1516,987,1932,1463,1012
,1843,1749,999,1
838,1277,1647,1925,1498,1742,1513,1880,1717,1016
,1953,1837,1867,1631,1469,1747,767,1904,1724,152
4,989,14
06,1754,1822,1835,1499,1944,1863,1890,1467,1003,
1522,1763,1695,1850,990,1005,1937,1722,1845,1495
,1655,17
65,1956,1487,1750,1869,1521,959,1896,1263,1940,1
770,1877,1509,1711,1756,1846,1011,1960,1784,1870
,1662,10
13,1985,1753,1927,1528,1849,1882,1766,1511,1954,
1719,1777,895,1439,1006,1878,1891,1939,1661,1502
,1986,18
52,1934,1723,1772,1515,1897,1014,1470,1743,1931,
1017,1968,1881,1894,1769,1517,1778,1941,1823,165
9,1992,1
875,1755,1501,1018,1900,1725,991,1933,1839,1525,
1955,1988,1884,1726,1948,1780,1518,1020,1767,190
5,1851,1
893,1945,1757,1530,1958,1471,1007,2000,1847,1898
,1523,1942,1961,1871,1771,1529,1912,1758,1989,19
46,1526,
1906,1883,1773,1957,1853,1976,1015,1751,1993,150
3,1962,1781,1885,1908,2016,1854,1532,1972,1774,1
019,189
5,1987,1969,1782,1279,1943,1899,1994,1663,1964,1
785,1021,1935,1886,2001,1407,1779,1990,1970,1879

,1022,1902,1947,1759,1907,1527,1996,1786,1959,2002,1913,1949,2017,1534,1788,1910,1965,2004,1901,1966,1775,2008,1531,1971,1950,1909,1991,2018,1727,1916,1855,1974,1995,2020,1977,1787,1914,2005,1887,1023,1963,1998,1783,2024,1980,1903,1973,2003,1789,1997,2032,1978,1917,2010,1519,2019,2006,1951,1911,2021,2009,1790,2026,1975,2012,1967,1915,2025,2022,1981,1918,2033,1999,2028,1533,2011,1982,2034,1979,2023,2013,2036,2007,2030,2014,2040,1535,2027,2029,2035,2037,1791,2038,2041,1919,2042,2039,2044,2043,2031,1983,2046,2047,2015,2045]

**Sequence group 7: Z7_2048**

[0,1,2,7,3,8,11,24,4,10,13,28,16,33,35,77,5,12,14,32,19,38,47,81,22,46,42,88,57,96,102,166,6,17,21,40,23,45,51,90,29,55,59,97,72,110,116,184,34,61,75,114,80,123,133,195,87,135,146,221,151,232,252,363,9,18,26,54,30,58,71,105,36,76,62,117,84,127,140,204,44,74,86,134,92,143,150,227,100,153,168,244,182,260,277,402,53,89,98,149,111,160,176,257,121,177,194,269,206,291,307,433,137,202,224,297,230,308,331,462,249,339,357,483,376,504,541,725,15,25,31,73,39,79,82,139,48,85,93,148,101,158,163,254,56,94,103,161,115,175,191,272,126,192,203,286,226,304,326,451,64,108,122,181,128,193,209,299,147,222,231,310,248,337,351,482,162,240,258,343,270,371,378,501,293,390,420,530,441,558,614,727,69,124,142,212,157,229,247,341,167,250,263,362,278,377,401,521,189,273,287,387,309,412,437,568,322,444,467,592,489,624,644,819,208,300,316,424,344,450,471,607,375,479,502,636,532,648,700,874,399,512,542,675,553,715,737,915,611,751,773,908,799,951,1005,1192,20,37,41,91,49,95,106,174 ,50,107,118,185,130,205,213,324,63,119,131,218,144,225,238,325,152,237,253,356,274,374,382,500,67,141,154,220,171,241,259,372,179,267,279,384,290,409,428,550,178,288,302,408,321,438,453,593,346,473,490,623,510,642,680,859,78,165,172,265,188,284,301,403,196,306,314,435,332,460,477,621,251,327,345,465,364,487,509,638,393,516,546,672,571,712,740,902,283,359,385,497,407,529,548,702,431,564,578,724,615,762,782,939,468,613,625,774,639,801,766,965,689,851,875,1016,881,1081,1115,1229,83,186,190,320,242,336,350,472,266,355,365,494,392,518,545,704,280,388,406,519,422,549,573,730,445,581,606,756,637,779,817,973,323,410,427,572,452,599,629,768,492,630,646,813,690,797,865,1022,527,666,708,853,731,880,905,1058,763,911,910,1105,967,1127,1155,1308,358,442,474,631,517,647,679,829,547,703,717,876,748,887,909,1077,574,735,770,903,786,913,969,1129,827,978,1001 ,1161,1040,1201,1226,1385,622,776,809,971,863,974,1030,1174,872,1026,1062,1215,1094,1247,1294,1444,889,1084,1123,1263,1146,1300,1278,1463,1189,1331,1352,1516,1396,1544,1581,1667,27,43,52,99,60,120,132,210,66,136,145,217,156,235,239,368,68,155,164,234,173,285,294,398,198,296,319,432,334,455,475,634,70,170,187,289,200 ,317,328,448,211,340,352,480,370,505,524,650,223,360,381,514,404,544,559,694,414,551,583,734,590,754,777,1011,109,199,207,333,219,353,369,496,245,383,394,536,417,566,580,706,264,397,426,556,447,588,595,742,464,597,604,781,664,802,845,1024,281,446,458,602,486,627,633,791,508,663,683,826,720,860,877,1065,535,699,732,879,764,900,943,1097,807,948,980,1130,1002,1165,1206,1378,112,215,236,379,262,395,421,570,276,429,449,598,469,609,617,788,305,459,485,619,507,658,677,822,533,692,718,870,743,890,927,1068,329,495,523,681,560,709,707,893,575,736,752,916,793,945,957,1135,608,765,805,952,823,987,1004,1176,850,1020,1049,1216,1103,1253,1297,1451,348,540,565,738,594,761,795,949,655,806,834,997,838,1008,1037,1199,667,836,849,1029,897,1048,1088,1244,936,1100,1121,1264,1153,1314,1336,1470,693,907,922,1071,962,1107,1126,1287,981,1151,1179,1328,1207,1356 ,1391,1525,1053,1181,1219,1363,1260,1402,1419,1571,1289,1435,1461,1591,1493,1628,1661,1772,129,246,268,430,303,457,481,641,312,488,513,661,537,686,729,929,342,525,569,705,585,759,745,938,600,771,798,977,830,991,1014,1190,405,576,601,757,654,790,810,1000,660,833,843,1015,862,1038,1057,1233,668,856,884,1055,934,1087,1117,1267,954,1143,1152,1319,1180,1337,1371,1509,416,653,657,824,671,837,869,1044,698,898,919,1079,946,1112,1148,1303,804,931,964,1119,983,1162,1183,1333,1041,1186,1222,1365,1262,1398,1415,1569,842,986,1028,1164,1054,1212,1236,1377,1092,1251,1272,1412,1301,1437,1468,1607,1124,1292,1324,1460,1351,1484,1508,1632,13
82,1519,1541,1656,1556,1693,1700,1831,425,673,68
5,925,789,941,956,1141,815,975,995,1169,1034,1195
,1231,13
73,847,1012,1051,1203,1075,1239,1275,1407,1114,1
298,1269,1429,1334,1465,1492,1613,937,1059,1086,
1255,113
3,1280,1321,1456,1159,1325,1350,1485,1369,1495,1
527,1651,1208,1359,1388,1513,1421,1548,1563,1681
,1442,15
86,1604,1712,1629,1732,1736,1804,984,1089,1156,1
326,1193,1346,1360,1504,1227,1395,1404,1536,1431
,1549,15
93,1698,1235,1427,1458,1584,1490,1608,1611,1734,
1521,1634,1647,1749,1674,1776,1791,1867,1306,148
0,1486,1
624,1532,1636,1658,1755,1554,1680,1686,1786,1717
,1792,1833,1888,1577,1709,1729,1814,1752,1819,18
46,1909,
1765,1850,1864,1922,1878,1934,1943,1982,138,113,
65,275,104,255,180,470,125,183,201,418,216,338,31
1,528,15
9,214,233,318,256,386,354,603,292,366,400,503,434,
659,562,785,169,243,261,373,295,391,439,543,313,4
61,413,7
26,493,577,612,1009,335,443,515,589,478,632,697,8
95,538,684,656,812,741,930,839,1178,197,282,298,4
23,330,4
54,499,618,361,555,463,645,526,669,714,848,389,49
1,587,695,563,780,682,873,520,719,800,906,758,104
2,950,13
30,415,584,539,749,649,728,820,921,610,857,772,98
8,811,961,1142,1080,674,828,867,1063,894,998,1023
,1200,92
3,1101,1047,1293,1131,1420,1245,1564,228,315,349,
484,380,511,554,701,411,620,531,722,579,746,792,9
70,436,5
61,651,755,605,844,775,955,670,814,885,1003,861,1
032,1091,1220,466,640,591,796,716,831,891,1019,69
6,933,84
6,1150,917,1060,1069,1270,750,882,976,1090,947,11
11,1170,1438,1017,1188,1136,1285,1230,1339,1370,
1598,506 ,662,733,871,688,896,959,1099,767,992,91
8,1211,1025,1120,1167,1318,803,942,1033,1144,107
8,1184,1266,1349,
979,1241,1194,1406,1290,1384,1462,1644,835,1052,
1095,1249,996,1217,1277,1479,1125,1312,1343,1414
,1228,15
17,1445,1806,1154,1329,1364,1505,1387,1467,1494,
1691,1296,1538,1557,1623,1580,1757,1660,1927,271
,367,396 ,557,440,626,582,784,456,596,710,818,652,
854,886,1046,498,676,635,868,713,953,840,1076,760
,899,968,1106,92
4,1198,1163,1433,534,723,687,1010,808,892,928,111
3,747,944,985,1256,1027,1139,1185,1353,825,1045,9
99,1210 ,1096,1173,1261,1381,1067,1240,1282,1401,
1317,1448,1511,1618,567,864,739,963,778,1056,990,
1218,841,1018,1
083,1191,1110,1248,1288,1422,904,1145,1070,1341,
1039,1258,1281,1497,1187,1311,1357,1452,1383,147
7,1543,1
707,940,1160,1108,1295,1205,1332,1403,1531,1252,
1428,1345,1502,1368,1589,1560,1685,1128,1394,146
6,1575,1
436,1550,1640,1678,1487,1626,1599,1744,1669,1725
,1777,1938,628,794,878,1043,920,1074,1168,1302,96
0,1224,
1093,1327,1137,1274,1386,1529,852,1118,1157,1366
,1214,1449,1342,1515,1273,1409,1432,1582,1310,16
33,1558,
1832,1013,1177,1246,1474,1305,1418,1399,1616,120
4,1440,1507,1570,1483,1594,1655,1731,1361,1499,1
464,160
5,1530,1695,1639,1751,1561,1662,1710,1785,1687,1
770,1847,1887,1050,1259,1323,1439,1225,1537,1469
,1622,13
79,1476,1579,1648,1506,1668,1714,1800,1286,1551,
1523,1673,1585,1728,1689,1796,1630,1702,1760,178
1,1743,1
863,1838,1912,1411,1609,1566,1723,1653,1810,1704
,1827,1539,1762,1737,1844,1748,1855,1877,1997,16
01,1803,
1787,1892,1775,1870,1902,1948,1823,1897,1885,196
5,1919,2017,1956,2029,347,419,476,643,522,665,711
,888,55
2,783,691,972,744,914,1006,1166,586,721,821,932,7
69,1073,966,1197,855,1036,1109,1338,1021,1221,12
54,1454,
616,816,787,994,866,1031,1098,1268,935,1147,1061,
1234,1134,1291,1375,1501,901,1116,1085,1284,1172
,1354,1
320,1481,1213,1367,1408,1659,1424,1568,1542,1722
,678,832,926,1072,993,1102,1242,1309,883,1122,118
2,1340,
1138,1397,1347,1524,982,1202,1223,1447,1158,1374
,1430,1578,1299,1459,1393,1553,1496,1600,1637,17
69,1066,
1238,1322,1413,1276,1475,1453,1615,1358,1534,150
3,1595,1446,1641,1665,1758,1265,1547,1520,1649,1
583,170
3,1682,1797,1489,1675,1718,1859,1742,1837,1818,1
931,753,1007,912,1171,958,1316,1149,1425,1082,11
96,1271,
1417,1250,1390,1472,1619,1064,1362,1283,1510,123
7,1457,1443,1643,1344,1491,1555,1603,1533,1670,1
692,178
9,1132,1307,1380,1478,1405,1574,1526,1708,1313,1
514,1610,1684,1552,1663,1735,1811,1426,1596,1573
,1697,16
45,1764,1720,1829,1635,1740,1794,1842,1774,1866,
1874,1971,1209,1434,1348,1565,1389,1540,1606,172
6,1455,1
666,1590,1713,1625,1747,1761,1848,1488,1650,1617
,1771,1696,1754,1801,1910,1676,1821,1778,1862,18
12,1884,
1899,1946,1522,1621,1705,1788,1664,1798,1826,187

9,1739,1854,1808,1896,1843,1905,1921,1963,1724,1830,1856,1939,1876,1914,1926,1985,1816,1933,1950,1978,1957,1991,2004,2034,858,1035,989,1279,1104,1315,1257,1471 ,1140,1232,1392,1576,1355,1498,1545,1677,1175,1372,1335,1512,1441,1638,1535,1701,1423,1559,1597,1746,1620,1719,1779,1858,1243,1450,1410,1567,1482,1588,1602,1727,1376,1614,1654,1780,1688,1767,1756,1869,1518,1657,1706,1753,1679,1795,1813,1890,1642,1824,1790,1881,1840,1907,1918,1973,1304,1400,1528,1652,1473,1631,1699,1783,1572,1733,1671,1768,1562,1802,1817,1895,1592,1690,1711,1861,1738,1809,1834,1942,1763,1852,1825,1904,1873,1915,1936,1981,1627,1716,1784,1835,1745,1882,1853,1923,1805,1845,1891,1929,1865,1961,1944,1988,1773,1880,1903,1947,1916,1968,1958,2001,1898,1953,1979,2009,1972,1995,2013,2037,1416,1500,1546,1694,1612,1759,1683,1822,1587,1721,1715,1849,1750,1868,1841,1935,1646,1793,1741,1836,1807,1857,1893,1928,1782,1883,1901,1945,1875,1954,1967,2000,1672,1766,1828,1871,1799,1906,1886,1951,1815,1894,1913,1983,1932,1959,1962,2008,1851,1925,1941,1966,1920,1989,1974,2006,1908,1977,1994,2021,1987,2012,2019,2043,1730,1820,1839,1924,1872,1900,1940,1969,1860,1911,1930,1975,1949,1992,1984,2015,1889,1937,1952,1990,1960,1980,1999,2025,1964,2003,1996,2018,2007,2023,2027,2046,1917,1955,1970,1998,1976,2002,2011,2022,1986,2010,2005,2030,2016,2031,2026,2042,1993,2014,2020,2032,2024,2033,2035,2039,2028,2036,2038,2041,2040,2047,2044,2045]

**Sequence group 7: Q7_4096**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1026,520 ,288,528,192,544,70,44,131,81,50,73,15,320,133,52,23,134,384,76,137,82,56,27,97,39,259,84,138,145,261,29,43,98,515,88,140,30,146,1028,71,262,265,161,576,45,100,640,1025,51,148,46,75,266,273,517,104,162,53,193,1032,152,77,164,768,2048,2049,268,274,518,54,83,57,521,112,1024,135,78,289,194,85,276,522,58,168,139,99,86,60,280,89,290,529,524,196,141,1040,101,147,176,142,530,321,31,200,90,1056,545,292,322,532,263,149,102,105,304,296,1030,163,92,1033,47,267,385,546,324,208,386,150,153,165,106,55,328,1088,536,577,548,1034,113,154,79,269,2050,2052,108,578,224,166,519,552,195,270,1041,641,1036,523,275,580,291,59,2056,2064,169,560,114,277,156,87,1152,197,116,170,61,1042,531,525,642,281,278,526,177,293,388,1057,2080,2051,91,584,769,198,172,120,201,336,62,282,143,1029,1044,103,178,294,93,1058,644,202,592,323,392,297,2053,2112,770,107,180,1280,151,209,284,1027,648,94,204,298,400,608,1089,352,325,533,155,210,305,547,300,109,1048,184,534,1060,537,115,1090,167,225,326,306,772,157,656,329,110,2057,2054,117,212,171,1038,776,1064,330,1153,226,549,1043,538,387,308,216,416,271,279,2065,2058,158,337,550,672,1092,118,332,579,540,1072,389,173,1037,121,553,199,784,179,228,338,2066,2176,312,1536,704,1154,2060,2081,390,174,554,581,1046,393,283,122,448,353,561,1096,203,63,340,394,1049,1281,527,582,556,181,295,1059,285,232,2113,2068,124,205,182,643,1156,562,2304,2082,286,585,299,354,1045,211,401,1104,185,1061,396,344,586,645,1282,593,535,240,1050,206,95,327,564,800,2072,2084,402,356,2055,2177,307,301,417,1160,213,1066,568,1120,832,588,1035,1537,186,646,404,1091,227,896,594,418,302,649,2114,2560,771,360,539,111,1052,331,1168,214,2059,2088,309,1062,1284,188,449,1073,217,408,609,596,551,650,229,159,420,310,1093,541,2116,2178,1288,773,610,657,333,1065,119,1098,600,339,1184,218,368,652,1031,230,391,313,450,542,1538,334,2067,2061,2096,2062,1076,233,555,774,175,123,1155,658,2120,2305,612,341,777,220,314,1105,424,106 8,395,673,583,355,1296,1094,287,183,234,1051,2069,2180,125,557,1216,660,616,342,2083,2306,316,1157,241,778,563,1074,345,452,397,403,1112,207,2074,2561,1540,674,558,785,1100,432,1039,357,187,1162,236,664,1312,624,587,780,1080,1122,2128,2085,705,126,242,1063,2073,2070,565,398,346,456,2184,2308,358,405,303,569,1544,244,1158,1097,595,1283,189,566,676,1169,1054,1108,361,706,589,1344,215,786,647,348,2312,2086,419,406,2562,2144,464,680,2115,2089,801,1069,362,1164,2192,2076,590,409,1286,570,1121,788,1552,1106,597,1075,5

72,1186,
219,311,708,598,1289,601,651,421,792,802,2117,209
0,611,1047,602,1172,410,231,688,653,2564,2097,112
8,248,1
070,369,2122,2320,190,364,1568,654,1095,659,1161,
335,480,315,221,370,1285,613,1408,422,2208,3074,4
25,451,
2568,2336,1077,614,543,1298,235,412,343,372,2576,
2240,1185,775,317,1539,222,1099,426,453,237,1124,
559,117
0,2592,2118,1292,833,804,712,1082,834,661,1053,20
92,2179,2129,2098,808,779,1217,617,604,1541,433,7
20,816,
1101,2121,2063,1176,836,347,897,1136,243,1297,66
2,1600,454,318,675,2368,2181,1110,618,1081,898,78
1,1314,1
220,376,428,1546,2100,2071,665,736,567,1107,2182,
2432,1192,1078,2124,2185,840,625,238,1159,359,45
7,399,78
7,2130,2104,591,678,434,677,1290,1542,2075,2145,3
49,1300,1102,245,1188,458,666,1113,620,1553,1163,
1313,36
3,127,1067,191,1125,782,407,436,2087,2307,626,121
8,2132,2186,571,465,2193,2309,681,246,707,1346,20
77,2091 ,2146,2563,350,1084,599,668,1548,790,2136
,2188,1165,1320,460,1123,1200,249,682,1664,573,11
71,411,803,1116 ,789,1304,709,365,440,628,689,207
8,2194,374,1224,3076,2119,423,1556,466,793,2310,2
313,2209,2624,1130,250,
371,1174,2093,2148,481,574,1348,413,1109,603,366,
1545,1287,1055,468,1570,655,900,805,615,1166,684,
1409,71
0,2688,3073,1187,429,2099,2196,794,252,1114,373,6
05,1232,848,690,2094,2123,713,632,2314,2321,1316,
482,806 ,1132,2565,2152,1083,427,1177,904,1569,41
4,2210,2101,1291,223,1126,1554,663,692,835,1328,6
19,472,2241,308
0,1137,455,2200,2125,796,1189,1601,809,714,1248,7
21,837,716,1086,2212,2816,1302,1352,864,810,1173,
606,119
4,912,1103,722,696,377,2316,2322,1424,435,2566,21
02,1293,1560,817,1129,1792,319,621,1180,2131,210
5,2569,2
160,812,484,1345,430,1572,1138,3072,2183,1299,83
8,667,1219,2126,2337,488,1111,239,378,459,622,141
0,627,22
42,2133,437,380,1201,1608,818,1178,2324,2570,129
4,461,1543,496,669,1190,1317,679,2106,2216,1140,1
079,218
7,2147,1221,724,841,1305,629,1584,2134,2108,351,4
67,2328,2137,1360,438,1115,737,2338,2577,251,462,
442,441 ,2572,2244,1666,469,1549,247,683,1196,218
9,3088,2149,2195,1226,842,1412,1127,738,1144,222
4,2190,1308,899,
1602,670,1318,783,1085,849,1555,1193,820,1576,72
8,928,791,367,2578,2369,1376,901,2079,2248,2138,3
104,123
3,630,2593,2340,1321,685,844,1204,633,711,2370,25
80,2311,2197,2150,2153,1118,253,691,1301,824,117
5,2352,2
344,902,686,1668,1222,1416,1133,740,1347,850,375,
1558,444,1306,470,1167,483,1547,415,3078,2211,48
5,905,21
40,3081,1202,795,473,1240,2095,2315,634,744,2433,
2594,1616,852,2372,2256,2434,2198,960,1322,2201,
2213,86
5,693,2154,2103,1131,1794,1350,797,1225,1604,157
1,906,2376,3136,1252,715,1141,1330,807,474,636,11
79,694,2
54,1550,1665,2584,2625,717,1071,2596,3082,1315,5
75,913,1440,798,811,379,1208,2161,2202,1353,1191,
2127,23
17,697,1564,431,1142,607,1228,2156,2626,489,1324,
2272,2214,866,723,2567,2600,486,1573,1181,1234,9
08,1793,
1561,718,813,1364,2243,2318,476,856,3089,2689,11
17,1411,839,1329,1295,1146,3084,2571,725,698,147
2,914,23
23,2628,1249,752,868,819,1349,814,439,929,2339,21
07,1197,1578,490,1139,2217,2608,1680,623,2162,23
25,1632,
1336,671,1198,1362,739,2204,2135,1603,1557,3200,
2245,2164,2218,1413,916,1303,463,1236,843,2109,3
090,1135 ,381,1672,1354,2579,2573,497,1586,930,82
1,2690,2329,726,961,1203,1182,2326,2574,872,1418,
492,1250,1332,63
1,2225,2341,2436,3105,1574,1223,729,1145,1605,70
0,2139,2632,1796,443,2817,2246,1307,741,2220,216
8,1378,1
562,1356,1205,845,1319,2249,2384,920,382,2110,23
30,1585,822,1425,851,2191,3077,3092,2151,1229,73
0,1609,4
98,2226,2342,880,1256,742,445,1392,471,2141,3106,
2692,2250,2640,2371,635,1148,1696,932,1580,687,2
440,234
5,1210,1420,1612,1325,1800,903,1134,825,1235,136
1,500,1577,846,1670,1195,745,2818,2155,2228,3328,
826,732,
2199,2257,2332,3075,1264,446,2696,2142,962,1426,
1620,936,2252,2346,1377,475,2448,2656,3137,2400,
2373,258
1,853,1310,867,637,2203,2258,1551,1230,2353,2595,
1414,907,1206,1667,1588,1333,487,1808,2348,2157,
695,144
1,1087,746,828,753,1610,854,1237,1326,3096,2232,8
57,1368,2582,3108,1209,504,799,1355,2585,2163,25
5,964,31
38,2215,2273,2374,1242,909,2354,2820,2205,2704,1
673,1559,1309,719,2377,2158,1143,477,2165,2260,1
617,915,
1448,1380,2219,3086,638,748,2824,3112,944,1728,1
331,1227,869,1592,1428,491,699,1253,1351,754,237
8,3201,1
183,1565,2274,2597,858,1618,1417,1476,3091,2586,
478,968,1260,383,2435,2356,1212,910,1801,815,226
4,2464,1

579,976,2319,2327,870,1684,1633,917,2206,2385,2598,2720,3140,2166,1337,1241,2380,2627,1606,1824,727,1150 ,1442,493,1357,1251,2588,3120,1676,873,2437,2221,1384,701,3085,2169,1566,931,1323,1798,1365,1473,2601,22
47,756,1334,860,499,2832,2227,731,1648,1238,823,1575,922,1199,1674,2276,2386,874,1432,1421,918,2360,3584,
2752,3202,1636,1254,2438,2222,502,1795,2602,2629,933,1366,3094,2441,1338,1682,2331,2170,2496,2401,1587,1
211,1488,743,1358,760,2609,3144,1244,1581,881,1147,2251,2111,494,1379,1272,702,2388,2442,3097,3329,921,1
624,501,876,2575,2630,1415,847,1856,1444,992,1697,2604,2229,2343,3107,2333,2280,447,1607,1436,1369,2172,
2253,1257,1704,2230,2691,733,1797,3204,2610,1669,1340,1231,827,1590,934,2334,2633,1634,1474,2347,2402,30
93,2259,882,937,2449,3152,2233,3109,963,1419,747,1265,2444,2392,1119,505,1381,855,2634,2693,924,1810,333
0,2641,2583,2288,3098,2254,734,829,1563,1213,2143,2375,1611,1363,2612,2848,1430,1258,1688,1386,965,1614,
1730,1239,2450,2404,938,884,506,1327,1589,1804,2355,2349,2465,3208,749,1370,2261,3114,2616,3168,1640,945 ,2880,2636,966,1456,1681,755,3083,3585,2234,2694,1266,859,2452,3139,2275,2944,2642,2466,1427,1593,1388,9
40,2350,2697,1214,830,2819,2408,1809,911,1621,1582,2587,2159,1832,871,3100,2379,639,1480,1698,1335,888,1
372,1245,479,1422,1268,3216,2262,946,1732,2357,3110,1677,750,1802,1626,3332,2236,2497,3121,1393,969,2265 ,2456,2657,2644,508,1613,2599,2698,2277,2207,861,1446,2468,2358,1857,1339,3141,2589,757,1382,3336,2821,9
70,1700,2658,2705,2381,3113,1243,919,2167,3146,1594,1433,1826,1504,875,1635,1259,862,2648,2387,1920,1675 ,3232,2266,1445,758,2416,2700,1149,948,1359,1816,3079,2278,1596,1671,1712,977,2439,2361,1385,923,1622,97
2,2498,2590,1434,1311,3586,2382,1729,761,1396,877,3124,2281,2603,2822,2223,2171,3203,2706,1207,1475,2660 ,2389,1449,1812,952,1686,2825,2268,495,1262,2362,3153,1644,1619,2472,3116,1341,1429,2443,2721,1825,703,1
371,1638,1567,1736,2631,2403,935,1685,978,1625,3344,3142,883,762,1246,503,2335,2231,1458,925,1394,1269,2
282,3099,878,1478,735,1799,2173,2605,3264,2708,2664,2390,1678,1860,2364,3205,2289,2826,2611,3122,1443,16
37,2393,2500,1481,1373,2445,2451,3160,2255,1699,1255,993,1591,1828,1452,3588,2722,885,939,994,1400,2606,
2833,3148,2480,1744,1656,3087,2405,2235,3210,980,1689,926,764,2284,2712,1270,941,1628,1367,1805,1457,336
0,2672,2635,2828,3128,3170,1921,1583,2753,2174,1387,1642,2290,3111,967,1267,2613,2446,1484,1450,2394,250
4,886,831,1683,1342,1811,947,2406,2453,2351,2617,3592,2292,1705,1431,3206,3145,2643,3331,507,1261,1840,8
89,2237,2614,1650,984,1760,1490,2724,3217,3102,3156,1615,751,2409,2754,2637,3392,2263,2834,1702,942,1858 ,1423,2695,2396,1460,1383,2467,2454,996,1692,1641,1814,971,1477,2512,2728,1273,1512,1733,890,1598,1374,2
849,3117,2410,3212,509,1806,2638,2457,3334,2618,1922,1649,3169,2836,3600,3154,949,973,2645,3123,2620,323
4,1397,1489,2267,2359,2756,2646,3337,2649,1708,1627,2699,2469,1000,1690,2840,2850,892,1274,2659,3095,143
8,1817,2650,3220,2458,2279,1390,1464,2736,2701,1868,950,1151,1731,1506,1827,1597,863,3176,2296,3118,2417 ,1451,759,2238,2412,1864,1714,3616,2702,3143,2707,1701,1395,3209,2383,2528,2363,1803,1008,2269,2418,3333 ,2661,1623,1482,3456,2470,1276,510,2473,2499,1435,1652,3125,2662,2591,3346,2283,2460,2391,2420,979,1492,
3233,2823,953,1928,1829,1389,2365,3587,1738,763,2270,3147,1872,974,2474,2501,1453,1643,2285,3172,1713,18
18,1215,1402,2607,3218,1629,1520,1830,1691,3340,2881,954,1459,1734,879,2852,2760,3130,2882,981,1505,2709 ,3101,1706,982,2856,2827,3265,2665,2652,3589,2481,2768,2864,3149,1924,927,3224,2884,1833,1639,2395,2945,
3184,2291,1447,1746,3345,2710,1343,1679,3648,2502,2366,2723,1820,1761,1479,1275,995,1740,3158,2666,1401,
1888,765,956,3129,2946,2829,3362,1496,1861,3268,2424,887,1437,985,1720,2476,3594,997,1630,1813,1462,2713 ,2784,2615,3155,3240,3126,1398,1645,2888,2673,2286,3207,2407,2505,2447,2835,1848,1687,2639,2726,1247,171
6,2482,2725,3338,3590,1936,986,1483,1651,1745,943,2397,3348,1859,1508,3150,2293,3236,2506,1834,1454,2714 ,3161,2668,3601,891,1841,998,1595,3211,3361,1278,766,1465,1709,2411,2175,1764,1646,3115,2239,3173,2830,2
455,2484,1737,511,2674,3266,1485,1404,2619,2513,1693,1866,2729,2294,2755,3394,1952,1491,988,1657,1752,18
07,2398,3132,2647,2716,3596,2838,1399,1844,3213,3368,2508,3171,1001,951,1654,1926,3248,2297,2730,3712,17
07,1391,2621,3219,2459,2851,1002,1468,3164,2837,3352,2757,2413,2488,1836,1494,1873,1271,2676,2737,1694,8
93,2422,3272,1923,1461,2471,3604,1748,1715,2514,2841,975,1862,894,1815,3178,2298,2419,3222,1497,1653,252
9,2622,3396,2461,3157,2651,2414,3593,1510,1762,3335,3103,2516,3618,1842,1375,2703,2948,2853,2663,3214,27
32,1703,1009,3457,2758,1466,1874,3235,2477,955,1739,2842,2300,3162,2421,2653,3280,2896,2738,1486,1930,27
61,2680,1889,1004,1658,1821,1718,1929,3364,2530,2854,3180,1599,1507,3131,2475,1776,1405,3225,2952,3617,2
462,1735,1831,3339,2271,3174,3602,1493,1010,2711,2740,2883,3376,1984,1455,2667,2520,957,1865,3185,2503,2
844,3237,3649,2857,2762,3296,2769,2885,2764,3134,983,1710,3350,3400,958,1514,2912,2858,3221,2654,1876,17
68,3242,2960,1721,1938,3151,2770,2744,2425,1660,1500,1403,1892,3472,2483,1819,1741,1516,987,3341,3608,19
32,1463,2865,3177,3840,2367,1012,1843,2669,3228,1749,999,2860,2532,3393,2478,3620,3186,3347,2886,2715,32
67,1838,1277,2536,3159,2287,2426,2507,2670,3458,2675,1647,1925,2485,2428,1498,1742,3249,3656,2866,3226,1
513,1880,1717,1016,1953,1837,3342,2509,1867,1631,3591,2544,2717,3238,1469,1747,3365,2727,767,1904,1724,1
524,3188,3127,989,1406,1754,1822,3269,2772,2889,3353,2677,3632,2399,2515,3408,2486,3163,2785,2299,2510,2
490,2489,1835,1499,3714,2517,3597,2295,2731,3244,1944,1863,1890,1467,1003,1522,3274,2890,3460,3175,2786,
3192,1763,1695,3356,2947,3650,2718,1850,990,1005,1937,3366,2831,3133,2897,1722,1845,3603,3241,1495,1655,
2868,3624,2776,2976,2839,2415,1765,1956,3424,2949,1487,1750,3281,2678,1869,1521,3369,2733,2892,3252,268
1,2759,959,1896,1263,1940,3166,2301,2739,3349,2872,3223,1770,1877,2950,2734,3716,3270,1509,1711,3464,318
1,2788,3395,1756,1846,2898,2423,3606,2492,1011,1960,3354,2518,3215,2531,3595,2463,1784,1870,1662,1013,25
33,2953,1985,1753,3250,2843,2521,3288,2682,2792,1927,1528,3664,2900,1849,1882,3008,3370,2913,2741,1766,1
511,3179,3842,3398,2845,3273,3652,3619,2954,1954,1719,3300,2763,3189,3378,1777,895,2855,2522,2684,3227,2
742,2302,1439,1006,3598,3713,1878,1891,2765,3119,3363,2623,2961,3488,2846,2859,2427,3256,1939,1661,3401,
3239,1502,1986,2745,3612,1852,1934,2479,3190,2655,3276,2537,3372,1723,1772,2914,2771,1515,1897,2534,362
1,3229,3282,2956,3841,3609,2766,1014,1470,2861,3412,1743,1931,2524,2904,3165,3459,2887,3377,3343,3194,27
73,2746,3520,2962,1017,1968,3297,2800,2916,2867,3397,2862,2487,2977,1881,1894,3245,3626,1769,1517,2538,3
187,1778,1941,1823,1659,3728,2671,1992,1875,3680,3384,1755,1501,2719,3246,3410,2787,1018,1900,3651,3605,
1725,991,3461,2964,3351,2511,3284,2891,3183,2429,3720,3402,2545,3634,2978,2869,2774,3009,3251,3230,1933,
1839,2920,3466,2540,3298,3380,2679,1525,1955,1988,1884,1726,1948,3622,3271,2777,3193,3653,2748,1780,151
8,3844,2491,1020,1767,1905,1851,3355,2789,1893,1945,3426,3610,3404,3253,2893,3367,2968,2430,3633,2870,34
73,2899,3277,2778,3657,2546,1757,1530,2928,3304,2790,2493,3440,2519,1958,1471,1007,2000,2683,3196,3744,2
980,3628,2735,1847,1898,3258,3468,3660,3373,1523,1942,3848,2951,3182,2873,1961,1871,3283,3409,1771,1529,
2548,3625,2894,3718,3243,2793,1912,1758,2874,2780,1989,1946,3312,2494,3010,3474,3668,2984,3425,2523,152
6,1906,2901,3358,2915,2685,3599,3278,1883,1773,3462,2955,3254,3715,3636,3381,2535,3856,1957,1853,2743,34
89,3135,2794,1976,1015,2876,2801,3658,2902,3285,3374,1751,1993,1503,1962,2905,3416,3257,2552,2847,3403,2
303,3012,1781,1885,3290,2957,1908,2016,3721,3607,3357,2767,3191,2525,3665,2963,3496,3428,2686,2796,1854,
1532,2992,3776,3379,3275,2917,3640,3476,2539,2747,3301,1972,1774,3399,2802,1019,1895,3231,3613,2906,366
6,3465,3524,2526,3016,3308,2431,1987,1969,3260,2958,3849,2863,3627,3024,1782,1279,2918,3732,3681,2965,19
43,1899,3385,3289,1994,1663,3654,3872,2775,3198,3490,2541,3405,3299,1964,1785,3724,2921,1021,1935,3432,2
749,3614,2979,3371,3846,3413,3521,2804,3382,2908,2547,2779,3696,3286,2871,3623,2970,3247,3722,1886,2001,
2922,3480,3469,2966,1407,1779,1990,1970,3684,3302,2550,3843,1879,1022,2981,3414,1902,1947,3386,3730,363
5,3259,3536,2791,3406,2808,3292,3629,2929,3195,2542,3427,3320,2750,2969,3672,2549,2924,1759,1907,3463,28
95,3904,3492,3040,3745,1527,1996,1786,1959,2495,3655,3484,3417,2002,1913,3305,3752,1949,2017,2781,3845,1 534,1788,3717,3388,3279,2875,3638,2982,3682,3522,2930,2985,3011,3467,2795,3313,3167,2553,3429,2903,2972,
3858,1910,1965,2782,2877,3611,3261,3659,3411,2004,1901,3478,3306,3736,3434,3013,3662,3778,3287,1966,177
5,2986,2932,2008,1531,2554,3375,3637,3852,1971,1950,2797,3418,3688,2993,3014,3504,3729,2803,3314,2907,19
09,1991,3475,3641,3436,2988,3262,2878,3857,2959,3669,3630,3880,2919,2018,1727,2687,3528,3746,3383,2936,3
420,3293,2527,3470,3316,1916,1855,1974,1995,2994,3780,3725,2798,3850,3674,3441,3017,2020,1977,2556,3661,
2909,3494,3905,3387,2805,3430,3018,3748,3291,2967,1787,1914,3642,3481,3874,3552,2923,3683,3307,2910,200
5,1887,3968,3723,1023,1963,3493,2806,3197,2996,3407,3864,3644,3719,3760,3025,3433,2971,3670,3020,3482,33
59,1998,1783,3777,2809,3444,2925,2024,1980,3255,3523,3497,3860,3000,3734,2543,3310,1903,1973,3692,3667,3
389,3477,3873,2751,3419,3686,3615,3784,2983,3733,3026,3673,2931,2810,3294,2551,3506,2973,3442,3317,2003,
1789,2926,3526,2783,3847,1997,2032,3726,3908,1978,1917,3491,3685,2010,1519,3529,3421,3747,3303,3041,363
9,3876,3500,2933,2987,3042,3448,3792,3704,3028,3737,2974,2812,3318,2989,3676,3415,3853,3505,2019,2006,39
69,3631,3435,3690,1951,1911,3015,3315,3532,3498,2021,2009,2934,2879,3731,3390,3859,2995,3753,3479,2555,3
309,3888,2937,3698,3032,3808,3538,3663,2799,1790,2026,3750,2990,3906,3471,3508,3431,3044,3740,3689,3862,
3019,3525,1975,2012,3321,3560,3781,2938,3646,3422,1967,1915,2557,3854,3970,3697,2997,3021,3445,3537,375
6,3675,3048,3738,2940,3322,3486,3865,3438,3512,2025,2022,3916,2998,3199,3779,3554,3875,3645,2911,1981,19
18,2033,1999,3499,2807,3912,3762,3749,3443,3851,3056,3671,3530,3324,2558,3483,3700,3027,3540,3001,3976,3
877,3437,3786,2811,2028,1533,3920,3022,3501,3691,3761,3866,3263,3450,3677,3568,3878,3739,3002,3507,3782,
2927,3029,3553,2011,1982,3754,3030,3972,2975,3881,3687,3495,3794,2034,1979,3391,3727,3868,3809,3527,332
3,3043,3788,3449,3936,2813,3004,3544,3909,2935,3485,3033,3768,3045,3678,3861,3510,2023,2013,3446,3693,20
36,2007,3896,3735,3295,3764,3984,3034,3531,3699,3793,2991,3907,3556,3882,3502,2939,3889,3046,3643,3326,2
814,3513,3757,3812,3694,2030,2014,3785,2559,3533,3452,3741,3914,2040,1535,4000,3539,3036,3705,3800,3855,
3447,3892,3049,2999,3702,3974,3755,3439,3050,3516,3884,3542,3921,3319,3742,2941,3971,3509,3796,3763,202
7,2029,3023,3910,2942,3863,2035,2037,3545,3701,3558,3810,3890,3423,3751,3057,3514,3922,3003,3787,3534,39
78,3937,3052,3706,3869,3766,3977,1791,2038,3647,3555,3824,3453,3783,3879,3541,3058,4032,3503,3005,3913,3
031,3758,3006,3562,3924,3816,2041,1919,3769,3986,3708,3548,3451,3940,3867,3789,3564,3035,3980,3511,3060,
3891,3797,3047,3886,3325,3695,3973,3546,3790,3561,3928,3765,3064,4001,3885,3915,3679,3517,3795,2815,395
2,3772,3572,3037,3454,3802,3870,2042,2039,3883,3547,3992,3911,3938,3515,3051,3570,3811,3743,3898,3038,30
53,3985,3770,3893,3543,3703,3813,4004,3535,3798,3917,3569,2044,2043,3007,3944,3311,3988,3818,3925,3557,3
759,3804,3894,3059,4008,3832,3918,3710,3061,4033,3801,3975,3576,3897,3930,2031,1983,3814,3559,4002,3767,
3825,2943,3487,3054,3926,3939,3987,3709,3550,4034,3900,3982,2046,2047,3771,3820,3563,3945,3062,3518,379
1,3979,3065,4016,3929,3942,3817,3565,3826,3989,3871,3707,4040,3923,3803,3549,3066,3948,3773,3039,3981,38
87,3573,4003,4036,3932,3774,3996,3828,3566,3068,3815,3953,3899,3941,3993,3805,3578,4006,3519,3055,4048,3
895,3946,3571,3990,4009,3919,3819,3577,3960,3806,4037,3994,3574,3954,3931,3821,4005,3901,4024,3063,3799,
4041,3551,4010,3829,3933,3956,4064,2015,2045,3902,3580,4020,3822,3067,3943,4035,4017,3830,3327,3991,394
7,4042,3711,4012,3833,3069,3983,3934,4049,3455,3827,4038,4018,3927,3070,3950,3995,3807,3955,3575,4044,38
34,4007,4050,3961,3997,4065,3582,3836,3958,4013,4052,3949,4014,3823,4056,3579,4019,3998,3957,4039,4066,3
775,3964,3903,4022,4043,4068,4025,3835,3962,4053,3935,3071,4011,4046,3831,4072,4028,3951,4021,4051,3837,
4045,4080,4026,3965,4058,3567,4067,4054,3999,3959,4069,4057,3838,4074,4023,4060,4015,3963,4073,4070,402
9,3966,4081,4047,4076,3581,4059,4030,4082,4027,4071,4061,4084,4055,4078,4062,4088,3583,4075,4077

,4083,4085,3839,4086,4089,3967,4090,4087,4092,4091,4079,4031,4094,4095,4063,4093]

**Sequence group 7: Z7_4096**

[0,1,2,7,3,8,11,24,4,10,13,28,16,33,35,77,5,12,14,32,19,38,47,81,22,46,42,88,57,96,102,168,6,17,21,40,23,45,51,90,29,55,59,97,72,110,116,186,34,61,75,114,80,123,135,197,87,137,148,225,153,238,260,381,9,18,26,54,30,58,71,105,36,76,62,117,84,127,142,206,44,74,86,136,92,145,152,233,100,155,170,252,184,268,287,424,53,89,98,151,111,162,178,265,121,179,196,279,210,301,317,461,139,204,230,307,236,320,345,494,257,353,375,519,396,544,587,815,15,25,31,73,39,79,82,141,48,85,93,150,101,160,165,262,56,94,103,163,115,177,193,282,126,194,205,296,232,314,340,481,64,108,122,183,128,195,213,309,149,228,237,322,256,351,369,518,164,246,266,357,280,389,398,539,303,412,446,574,471,608,678,817,69,124,144,216,159,235,255,355,169,258,271,380,288,397,423,563,191,283,297,409,321,438,465,618,334,474,499,650,527,688,714,943,212,310,328,450,358,480,503,667,393,515,540,704,576,718,786,1016,421,554,588,753,603,805,833,1073,673,853,883,1064,915,1129,1203,1490,20,37,41,91,49,95,106,176,50,107,118,187,132,207,217,336,63,119,133,222,146,231,244,337,154,243,261,374,284,392,404,538,67,143,156,224,173,247,267,390,181,275,289,406,300,435,454,600,180,298,312,434,333,468,483,651,362,505,528,687,552,712,758,993,78,167,174,273,190,294,311,425,198,316,326,463,346,492,509,685,259,341,359,497,382,525,549,706,415,558,594,750,621,802,840,1054,293,377,407,535,431,573,598,788,459,614,634,814,679,864,894,1103,500,675,689,884,707,917,870,1145,769,981,1017,1218,1025,1315,1367,1549,83,188,192,332,248,350,368,504,274,373,383,532,414,560,593,790,290,410,430,561,448,599,625,820,475,639,666,858,705,891,939,1153,335,436,453,624,482,657,693,874,530,696,716,935,770,911,1003,1228,571,742,796,985,821,1024,1059,1278,865,1067,1066,1351,1147,1387,1431,1684,376,472,506,697,559,717,757,955,595,789,807,1018,850,1033,1065,1309,628,829,876,1055,898,1071,1149,1389,951,1162,1199,1441,1254,1509,1546,1821,686,888,929,1151,1001,1156,1242,1464,1014,1234,1284 ,1529,1334,1581,1658,1934,1035,1320,1381,1605,1414,1668,1630,1963,1485,1725,1760,2074,1844,2124,2211,2399,27,43,52,99,60,120,134,214,66,138,147,221,158,241,245,386,68,157,166,240,175,295,304,420,200,306,331,460,348,485,507,702,70,172,189,299,202,329,342,478,215,354,370,516,388,545,568,720,229,378,401,556,426,592,609,776,440,601,641,828,648,856,889,1213,109,201,211,347,223,371,387,534,253,405,416,580,443,616,638,794,272,419,452,606,477,646,653,842,496,655,664,893,740,918,975,1230,291,476,490,662,524,691,701,903,548,739,763,950,810,994,1019,1289,579,785,824,1021,866,1050,1113,1337,925,1120,1166,1396,1200,1451,1518,1814,112,219,242,399,270,417,447,620,286,455,479,656,501,669,681,900,315,491,521,683,547,730,755,946,577,774,808,1010,843,1036,1091,1294,343,533,567,759,610,797,795,1039,629,832,854,1074,905,1117,1137,1401,668,867,921,1130,947,1181,1202,1468,980,1226,1267,1530,1347,1591,1661,1947,364,586,615,834,652,863,907,1121,727,924,962,1195,966,1208,1249,1505,743,964,979,1239,1047,1266,1326,1578,1100,1344,1379,1608,1425,1694,1738,1974,775,1061,1084,1297,1142,1355,1386,1647,1167,1419,1471,1720,1519,1768,1831,2089,1273,1473,1533,1781,1602,1858,1887,2185,1649,1913,1961,2235,2025,2312,2385,2666,129,254,278,458,313,489,517,711,324,526,555,737,581,766,819,1093,356,569,619,791,643,861,845,1102,658,877,914,1161,958,1187,1216,1486,427,632,659,859,726,902,930,1198,736,961,973,1217,1000,1250,1277,1555,744,990,1028,1275,1098,1323,1371,1611,1132,1411,1424,1701,1472,1739,1801,2057,442,725,729,948,749,965,1009,1260,784,1048,1081,1311,1118,1362,1416,1673,920,1095,1144,1373,1171,1448,1475,1727,1255,1480,1540,1787,1604,1850,1879,2179,972,1180,1238,1450,1274,1526,1562,1811,1332,1587,1618,1876,1669,1915,1972,2261,1384,1654,1712,1960,1759,2008,2056,2322,1818,2077,2117,2378,2158,2459,2472,2831,451,751,765,1089,901,1107,1136,1409,937,1157,1191,1459,1246,1497,1553,1805,977,1214,1269,1513,1307,1565,1621,1869,1366,1666,1613,1903,1730,1967,2024,2283,1101,1279,1322,1595,1399,1634,1703,1954,14 37,1713,1758,2009,1797,2029,2097,2363,1522,1775,
1826,2061,1891,2136,2173,2431,1930,2228,2258,251
0,2313,2
560,2578,2754,1176,1327,1434,1718,1491,1752,1778
,2048,1547,1839,1862,2110,1905,2137,2239,2470,15
59,1899,
1956,2224,2022,2266,2271,2574,2081,2324,2359,260
3,2414,2672,2719,2941,1676,2002,2010,2306,2106,2
328,238
0,2617,2154,2430,2444,2704,2525,2720,2839,3018,2
201,2503,2551,2782,2612,2793,2884,3089,2651,2902
,2936,31
42,2984,3186,3223,3400,140,113,65,285,104,263,182
,502,125,185,203,444,220,352,323,572,161,218,239,3
30,264,
408,372,663,302,384,422,541,462,731,612,897,171,2
49,269,391,305,413,469,589,325,493,439,816,531,63
3,674,12
09,349,473,557,647,514,700,781,1043,582,764,728,9
34,841,1094,967,1470,199,292,308,449,344,484,537,
682,379,
605,495,715,570,745,804,978,411,529,645,777,613,8
92,762,1015,562,809,916,1060,860,1258,1128,1724,4
41,642,5
83,851,719,818,944,1083,672,991,882,1184,931,1141
,1410,1314,752,954,1005,1285,1042,1196,1229,1508,
1085,13
45,1263,1655,1397,1890,1579,2174,234,327,365,520,
400,553,604,787,437,684,575,812,635,848,904,1150,
464,611,
721,857,665,974,885,1133,748,936,1029,1201,995,12
44,1329,1536,498,710,649,910,806,959,1037,1223,78
0,1097,
976,1418,1075,1282,1295,1614,852,1026,1160,1328,
1119,1361,1460,1924,1219,1484,1404,1645,1552,174
1,1800,2
248,546,738,825,1011,768,1046,1139,1343,871,1188,
1080,1525,1231,1378,1455,1700,919,1112,1245,1412
,1310,1
476,1610,1755,1163,1573,1496,1868,1652,1820,1962
,2352,963,1272,1335,1583,1194,1531,1627,2001,138
5,1690,1
749,1878,1548,2075,1935,2756,1430,1721,1786,2049
,1823,1969,2028,2455,1660,2114,2159,2305,2210,26
29,2384,
3163,281,385,418,607,470,690,640,896,488,654,798,
942,724,988,1032,1262,536,754,703,1008,803,1131,9
70,1308,
862,1049,1148,1354,1088,1504,1449,1909,578,813,7
67,1212,928,1038,1092,1363,849,1116,1177,1596,12
35,1407,
1477,1761,949,1261,1197,1524,1336,1463,1603,1817
,1293,1572,1638,1855,1699,1942,2059,2296,617,100
2,835,11
43,890,1276,1186,1532,971,1222,1317,1487,1360,15
82,1648,1892,1058,1413,1296,1745,1251,1598,1635,
2031,148
1,1687,1769,1948,1819,1995,2119,2495,1106,1440,1
358,1659,1515,1726,1859,2103,1590,1902,1751,2044
,1796,22
31,2168,2439,1388,1838,1968,2195,1914,2142,2338,
2424,2011,2310,2249,2596,2403,2539,2673,3214,692
,906,102
0,1259,1082,1306,1458,1672,1140,1542,1333,1719,1
405,1620,1822,2099,984,1372,1435,1794,1528,1943,
1748,206
9,1619,1873,1908,2214,1686,2323,2162,2838,1215,1
469,1580,1990,1675,1886,1851,2292,1514,1928,2053
,2184,20
05,2242,2373,2557,1779,2033,1966,2259,2102,2463,
2331,2607,2169,2386,2506,2703,2445,2662,2885,301
7,1268,1
599,1707,1925,1543,2111,1973,2304,1815,1994,2207
,2360,2052,2402,2520,2742,1646,2143,2083,2413,22
25,2550,
2453,2730,2318,2478,2642,2693,2595,2931,2858,309
8,1875,2267,2176,2535,2367,2770,2488,2815,2115,2
648,257
9,2874,2602,2917,2981,3473,2253,2747,2705,3032,2
669,2968,3064,3256,2805,3043,3009,3317,3127,3609
,3272,37
01,363,445,508,713,566,741,799,1034,602,895,771,1
152,844,1072,1204,1454,644,811,945,1096,875,1301,
1146,15
03,989,1248,1359,1740,1227,1537,1594,1950,680,93
8,899,1190,1004,1243,1342,1612,1099,1415,1283,15
58,1400,
1653,1807,2041,1051,1370,1321,1644,1462,1762,170
2,2003,1527,1795,1872,2381,1896,2178,2118,2534,7
56,960,1
090,1300,1189,1346,1576,1685,1027,1380,1474,1744
,1406,1845,1753,2088,1170,1512,1541,1939,1436,18
06,1904,
2206,1667,1957,1833,2151,2030,2252,2329,2657,129
2,1564,1706,1877,1626,1991,1949,2287,1774,2108,2
045,224
3,1938,2339,2391,2638,1609,2131,2080,2361,2215,2
479,2432,2731,2017,2415,2526,2923,2594,2855,2792
,3173,85
5,1205,1070,1461,1138,1698,1417,1897,1316,1502,1
615,1883,1586,1830,1982,2297,1288,1780,1639,2058
,1563,19
55,1931,2349,1750,2023,2155,2255,2107,2406,2458,
2713,1398,1677,1816,2000,1863,2194,2096,2502,169
1,2068,2
270,2438,2150,2387,2575,2771,1898,2246,2189,2467
,2353,2650,2528,2825,2325,2588,2726,2870,2668,29
40,2972,
3349,1523,1912,1754,2175,1827,2116,2260,2544,195
1,2398,2234,2511,2307,2601,2643,2888,2016,2362,2
293,266
3,2466,2616,2743,3096,2416,2797,2674,2930,2776,3
008,3051,3248,2082,2303,2489,2712,2390,2738,2814
,2985,25
85,2916,2764,3042,2871,3073,3139,3313,2538,2830,
2920,3215,2980,3108,3162,3419,2790,3183,3258,338

6,3273,3
459,3530,3756,992,1247,1185,1631,1350,1695,1597,1975,1408,1554,1832,2200,1763,2032,2125,2417,1465,1804,1
731,2060,1929,2330,2109,2473,1893,2163,2247,2600,2302,2527,2675,2922,1577,1946,1874,2177,2004,2230,2254,
2545,1810,2286,2372,2692,2452,2653,2628,2961,2076,2379,2494,2613,2425,2727,2777,3026,2348,2808,2718,298
7,2862,3083,3126,3361,1674,1854,2098,2366,1983,2319,2471,2701,2188,2561,2407,2656,2172,2746,2791,3039,22
38,2454,2507,2927,2584,2765,2842,3222,2649,2912,2809,3072,2971,3109,3208,3397,2311,2524,2702,2843,2597,2
990,2913,3143,2755,2875,3027,3169,2937,3303,3226,3434,2667,2986,3065,3249,3112,3334,3294,3505,3050,3265,
3387,3553,3360,3469,3583,3777,1882,2040,2130,2462,2282,2639,2433,2804,2229,2529,2521,2889,2606,2960,286
3,3187,2358,2721,2589,2854,2757,2921,3033,3168,2700,2991,3055,3227,2973,3268,3323,3504,2412,2652,2824,29
69,2739,3082,3016,3259,2783,3038,3099,3401,3182,3295,3312,3552,2903,3155,3217,3322,3138,3435,3362,3544,3
088,3373,3468,3639,3425,3582,3629,3869,2556,2796,2859,3154,2970,3054,3216,3335,2926,3097,3172,3363,3257,
3464,3418,3585,3019,3209,3264,3458,3302,3396,3499,3667,3316,3511,3472,3628,3545,3663,3693,3964,3113,326
9,3348,3498,3372,3510,3573,3662,3424,3572,3531,3728,3608,3729,3692,3868,3465,3584,3638,3734,3666,3735,37
57,3819,3700,3776,3818,3845,3844,3965,3886,3887,130,131,208,251,209,276,319,432,226,318,339,466,366,511,5
13,747,227,338,360,510,395,542,591,773,428,590,564,800,637,836,868,1108,250,367,403,550,429,585,623,822,46
7,631,661,837,732,886,922,1164,512,671,735,912,772,941,987,1183,793,997,1040,1281,1053,1312,1368,1657,277,
394,456,630,486,660,723,873,522,746,676,923,782,957,1012,1224,584,734,792,996,826,1023,1052,1299,846,1057,
1110,1348,1158,1390,1433,1742,627,801,838,1045,887,1078,1126,1377,933,1127,1182,1421,1232,1467,1507,1809 ,999,1220,1290,1489,1304,1510,1571,1870,1357,1593,1641,1921,1688,1976,2043,2389,361,433,487,733,543,761,7
78,1007,596,783,827,1044,847,1076,1087,1374,636,830,869,1079,913,1125,1175,1426,956,1178,1221,1452,1298,1
500,1566,1849,694,880,940,1155,968,1179,1237,149
3,1041,1286,1305,1516,1356,1589,1629,1920,1086,1338,1382 ,1607,1422,1679,1692,1965,1479,1716,1784,2020,1835,2078,2186,2393,709,952,1022,1252,1069,1303,1353,1601,
1109,1364,1393,1656,1438,1689,1737,1999,1173,1427,1453,1711,1511,1770,1825,2094,1556,1840,1885,2144,193
3,2202,2236,2547,1236,1494,1538,1790,1616,1848,1895,2167,1683,1917,1970,2220,2026,2244,2342,2632,1735,19
86,2046,2291,2067,2369,2409,2697,2181,2435,2475,2688,2513,2759,2837,3106,402,523,551,823,597,831,878,112
4,622,879,926,1165,982,1225,1253,1560,677,927,983,1270,1030,1291,1330,1561,1056,1325,1369,1640,1428,1682,
1704,1964,699,1013,1062,1280,1115,1339,1383,1680,1135,1403,1439,1708,1466,1765,1798,2064,1134,1456,1498,
1764,1551,1828,1853,2145,1622,1901,1936,2199,1984,2232,2300,2611,760,1105,1122,1395,1172,1446,1495,1743,
1192,1506,1534,1813,1574,1866,1911,2197,1365,1567,1617,1881,1662,1927,1981,2222,1723,1992,2054,2288,210
1,2364,2418,2682,1445,1643,1709,1953,1757,2019,2062,2344,1803,2090,2122,2388,2187,2450,2486,2737,1888,21
83,2203,2476,2223,2515,2460,2779,2321,2593,2633,2852,2641,2949,2999,3153,779,1168,1174,1550,1340,1588,16
28,1900,1402,1637,1663,1944,1722,1996,2051,2346,1442,1714,1756,1997,1788,2063,2105,2396,1841,2127,2166,2
442,2221,2483,2543,2789,1557,1766,1793,2104,1852,2153,2209,2464,1940,2212,2240,2537,2326,2509,2621,2864,
2015,2278,2354,2599,2397,2640,2685,2910,2451,2691,2690,2983,2781,3013,3057,3260,1642,1836,1906,2213,199
3,2241,2299,2563,2055,2345,2371,2634,2428,2655,2689,2945,2112,2405,2468,2683,2492,2695,2785,3015,2559,28
00,2833,3063,2890,3119,3150,3357,2198,2480,2531,2787,2619,2794,2876,3080,2630,2868,2918,3135,2964,3179,3
240,3432,2659,2952,3007,3199,3044,3246,3220,3453,3103,3289,3318,3520,3374,3554,3597,3695,457,565,626,839 ,670,932,986,1240,698,998,1031,1265,1068,
1319,1331,1670,708,1063,1104,1318,1123,1447,1482,1734,1206,1488,
1545,1808,1584,1857,1907,2218,722,1114,1169,1457,1210,1539,1568,1846,1241,1600,1632,1918,1678,1977,2012,
2250,1287,1650,1697,1988,1746,2050,2079,2334,1772,2065,2129,2404,2140,2440,2481,2847,881,1207,1233,1575,
1271,1633,1671,1952,1349,1705,1728,2036,1777,209

2,2126,2350,1394,1733,1792,2072,1843,2138,2147,2420,188 0,2149,2164,2485,2276,2516,2583,2866,1443,1842,1864,2160,1926,2205,2217,2499,1980,2275,2309,2558,2376,26 14,2635,2925,2035,2341,2400,2637,2456,2680,2745,2967,2523,2752,2802,3020,2834,3069,3124,3350,908,1257,13 24,1693,1392,1729,1785,2100,1432,1799,1847,2152,1889,2171,2191,2496,1501,1865,1923,2193,1979,2268,2295,2 552,2027,2332,2374,2626,2421,2660,2717,2932,1569,1945,2007,2301,2084,2355,2351,2665,2113,2408,2436,2698, 2501,2749,2767,3025,2170,2457,2519,2760,2553,2813,2836,3084,2592,2860,2899,3136,2979,3189,3243,3441,162 4,2042,2091,2410,2146,2449,2505,2753,2263,2522,2568,2827,2572,2844,2883,3117,2279,2570,2591,2873,2677,28 98,2956,3176,2734,2976,3005,3200,3053,3270,3296,3462,2333,2687,2710,2935,2774,2989,3012,3233,2803,3049,3 087,3286,3125,3324,3367,3529,2905,3091,3141,3331,3196,3380,3403,3587,3235,3421,3451,3607,3491,3650,3687, 3810,969,1352,1420,1802,1499,1861,1919,2227,1520,1932,1987,2273,2037,2316,2395,2723,1606,2013,2095,2347, 2133,2447,2423,2736,2156,2469,2512,2799,2564,2819,2850,3104,1747,2120,2157,2443,2262,2498,2532,2832,227 2,2567,2581,2851,2618,2886,2909,3159,2280,2608,2646,2907,2732,2955,3001,3203,2762,3037,3052,3277,3090,32 97,3341,3513,1776,2257,2265,2554,2285,2571,2625,2894,2340,2678,2707,2947,2750,2996,3046,3251,2518,2725,2 778,3003,2807,3066,3093,3291,2891,3100,3146,3333,3198,3376,3395,3581,2580,2812,2872,3068,2906,3132,3164, 3347,2962,3185,3210,3392,3247,3423,3460,3625,3010,3238,3282,3450,3315,3482,3512,3654,3354,3523,3549,368 2,3566,3723,3732,3875,1791,2289,2315,2715,2497,2741,2766,3035,2541,2795,2823,3075,2880,3111,3157,3343,25 87,2848,2901,3121,2943,3167,3213,3385,2998,3244,3205,3413,3292,3455,3490,3633,2735,2911,2954,3191,3023,3 224,3279,3446,3061,3283,3314,3483,3339,3493,3533,3677,3128,3327,3364,3517,3405,3558,3575,3711,3430,3602, 3622,3746,3651,3768,3772,3846,2810,2957,3058,3284,3107,3308,3328,3506,3151,3371,3382,3542,3415,3559,361 1,3730,3161,3411,3448,3600,3488,3626,3631,3770,3525,3656,3673,3787,3704,3814,3831,3913,3254,3478,3484,36 46,3538,3658,3684,3793,3564,3710,3716,3826,3751,3832,3877,3934,3593,3743,3765,3856,3790,3861,3892,3955,3 803,3896,3910,3970,3924,3982,3991,4030,1006,909,695,1429,872,1375,1154,1894,953,1159,1211,1782,1264,1592 ,1517,2018,1077,1256,1313,1544,1376,1710,1636,2161,1478,1664,1736,1971,1812,2269,2086,2491,1111,1341,139 1,1681,1483,1717,1829,2047,1521,1867,1771,2392,1941,2121,2182,2845,1585,1837,1989,2139,1916,2216,2337,26 71,2038,2314,2264,2536,2419,2724,2573,3086,1193,1444,1492,1789,1570,1856,1959,2192,1651,2071,1871,2237,2 014,2281,2368,2590,1715,1937,2135,2335,2087,2484,2308,2631,1998,2375,2514,2686,2446,2892,2758,3288,1773, 2132,2039,2429,2245,2394,2548,2709,2180,2609,2474,2816,2533,2773,3036,2948,2290,2562,2623,2919,2670,282 8,2865,3118,2711,2977,2897,3239,3021,3404,3177,3576,1302,1535,1625,1922,1696,1985,2070,2343,1767,2196,20 21,2382,2123,2426,2500,2786,1824,2085,2251,2441,2165,2582,2477,2763,2284,2540,2647,2835,2615,2878,2959,3 144,1884,2226,2141,2508,2370,2565,2661,2857,2336,2729,2586,3048,2699,2914,2933,3206,2434,2644,2798,2958, 2751,2995,3076,3426,2853,3102,3028,3231,3156,3299,3340,3616,1978,2274,2401,2627,2320,2676,2769,2975,246 1,2820,2706,3131,2867,3004,3071,3276,2517,2744,2879,3040,2946,3094,3202,3311,2801,3171,3110,3384,3236,33 56,3452,3670,2569,2904,2965,3181,2826,3137,3219,3477,3011,3266,3305,3394,3152,3521,3433,3848,3056,3287,3 332,3507,3359,3457,3492,3721,3242,3546,3567,3645,3596,3795,3686,3975,1423,1665,1732,2073,1834,2204,2128, 2490,1860,2148,2356,2546,2256,2604,2654,2896,1958,2294,2219,2624,2365,2761,2576,2944,2448,2679,2784,298 8,2714,3116,3067,3417,2034,2383,2317,2846,2530,2664,2722,2997,2427,2748,2811,3192,2869,3031,3095,3319,25 55,2895,2829,3130,2966,3079,3197,3353,2929,3170,3228,3379,3275,3438,3515,3640,2093,2620,2411,2775,2482,2 908,2818,3140,2577,2856,2951,3105,2994,3180,3234,3406,2684,3041,2934,3301,2887,3194,3225,3495,3101,3263, 3325,3442,3355,3475,3551,3741,2740,3062,2992,3241,3123,3290,3381,3537,3188,3412,3307,3502,3338,3605,357 0,3715,3014,3370,3456,3591,3422,3560,3664,3708,3

485,3648,3617,3782,3697,3761,3815,3986,2208,2504,2636,2893,2708,2942,3074,3250,2772,3148,2963,3285,3029,3212,3358,3535,2598,3002,3059,3336,3134,3439,3304,3519,3211,3389,3416,3598,3262,3655,3568,3876,2849,3085,3178,3470,3253,3402,3377,3636,3122,3428,3509,3586,3481,3612,3681,3767,3329,3497,3454,3623,3536,3725,3661,3789,3571,3688,3744,3825,3717,3808,3893,3933,2900,3195,3281,3427,3149,3543,3461,3644,3351,3474,3595,3674,3508,3696,3748,3840,3232,3561,3527,3703,3601,3764,3719,3836,3652,3736,3798,3821,3781,3909,3882,3958,3391,3627,3578,3759,3679,3852,3738,3871,3547,3800,3773,3890,3786,3901,3923,4045,3619,3843,3827,3938,3813,3916,3948,3996,3865,3943,3931,4013,3967,4065,4004,4077,1623,1783,1910,2233,2006,2277,2357,2658,2066,2487,2327,2788,2422,2696,2840,3070,2134,2377,2549,2728,2465,2939,2780,3115,2605,2882,2993,3298,2861,3145,3190,3444,2190,2542,2493,2822,2622,2877,2974,3204,2733,3045,2915,3160,3024,3237,3345,3501,2681,3000,2953,3230,3078,3320,3278,3479,3133,3337,3388,3685,3408,3580,3550,3758,2298,2566,2716,2938,2821,2978,3174,3261,2645,3006,3092,3300,3030,3375,3309,3528,2806,3120,3147,3437,3060,3344,3414,3594,3245,3449,3369,3563,3494,3618,3659,3807,2928,3166,3280,3393,3218,3471,3443,3635,3326,3540,3503,3613,3436,3665,3691,3796,3201,3557,3524,3675,3599,3737,3712,3837,3487,3705,3752,3905,3780,3881,3860,3979,2437,2841,2694,3077,2768,3274,3047,3409,2950,3114,3207,3399,3184,3366,3466,3641,2924,3330,3229,3514,3165,3447,3431,3669,3306,3489,3565,3621,3539,3698,3722,3829,3022,3255,3352,3476,3383,3590,3532,3742,3267,3518,3630,3714,3562,3689,3771,3853,3410,3614,3589,3727,3671,3802,3754,3873,3657,3778,3834,3888,3812,3912,3920,4019,3129,3420,3310,3577,3365,3548,3624,3762,3445,3694,3606,3747,3647,3785,3799,3894,3486,3676,3637,3809,3726,3792,3841,3956,3706,3863,3816,3908,3854,3930,3945,3994,3526,3643,3739,3828,3690,3838,3870,3925,3775,3900,3850,3942,3889,3951,3969,4011,3760,3874,3902,3987,3922,3960,3974,4033,3858,3981,3998,4026,4005,4039,4052,4082,2610,2881,2817,3221,2982,3271,3193,3463,3034,3158,3368,3592,3321,3496,3555,3707,3081,3342,3293,3516,3429,3660,3541,3733,3407,3569,3615,3784,3642,3753,3817,3904,3175,3440,3390,3579,3480,3604,3620,3763,3346,3634,3680,3820,3718,3805,3794,3915,3522,3683,3740,3791,3709,3835,3855,3936,3668,3866,3830,3927,3884,3953,3966,4021,3252,3378,3534,3678,3467,3653,3731,3823,3588,3769,3699,3806,3574,3842,3859,3941,3610,3720,3745,3907,3774,3851,3878,3990,3801,3898,3867,3950,3919,3961,3984,4029,3649,3750,3824,3879,3783,3928,3899,3971,3847,3891,3937,3977,3911,4009,3992,4036,3811,3926,3949,3995,3962,4016,4006,4049,3944,4001,4027,4057,4020,4043,4061,4085,3398,3500,3556,3724,3632,3797,3713,3864,3603,3755,3749,3895,3788,3914,3885,3983,3672,3833,3779,3880,3849,3903,3939,3976,3822,3929,3947,3993,3921,4002,4015,4048,3702,3804,3872,3917,3839,3952,3932,3999,3857,3940,3959,4031,3980,4007,4010,4056,3897,3973,3989,4014,3968,4037,4022,4054,3954,4025,4042,4069,4035,4060,4067,4091,3766,3862,3883,3972,3918,3946,3988,4017,3906,3957,3978,4023,3997,4040,4032,4063,3935,3985,4000,4038,4008,4028,4047,4073,4012,4051,4044,4066,4055,4071,4075,4094,3963,4003,4018,4046,4024,4050,4059,4070,4034,4058,4053,4078,4064,4079,4074,4090,4041,4062,4068,4080,4072,4081,4083,4087,4076,4084,4086,4089,4088,4095,4092,4093]

**Sequence group 7: Q7_8192**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1026,520 ,288,528,192,544,70,44,131,81,50,73,15,320,133,52,23,134,384,76,137,82,56,27,97,39,259,84,138,145,261,29,43,98,515,88,140,30,146,1028,71,262,265,161,576,45,100,640,1025,51,148,46,75,266,273,517,104,162,53,193,1032,152,77,164,768,2048,2049,268,274,518,54,83,57,521,112,1024,135,78,289,194,85,276,522,58,168,139,99,86,60,280,89,290,529,524,196,141,1040,101,147,176,142,530,321,31,200,90,1056,545,292,322,532,263,149,102,105,304,296,1030,163,92,1033,47,267,385,546,324,208,386,150,153,165,106,55,328,1088,536,577,548,1034,113,154,79,

269,2050,2052,108,578,224,166,519,552,195,270,1041,641,1036,523,275,580,291,59,2056,2064,169,560,114,277,156,87,1152,197,116,170,61,1042,531,525,642,281,278,526,177,293,388,1057,2080,2051,91,584,769,198,172,120,201,336,4096,4097,4098,4100,62,282,143,1029,1044,103,178,294,93,1058,644,202,592,323,392,297,2053,2112,770,107,180,1280,151,209,284,1027,648,94,204,298,400,608,1089,352,325,533,155,210,305,547,300,109,1048,184,534,1060,537,115,1090,167,225,326,306,772,157,656,329,110,2057,2054,117,212,171,1038,776,1064,330,1153,226,549,1043,538,387,308,216,416,271,279,2065,2058,158,337,550,672,1092,118,332,579,540,1072,389,173,1037,121,553,199 ,784,179,228,338,2066,2176,312,1536,704,1154,2060,2081,390,174,554,581,1046,393,283,122,448,353,561,1096,203,63,340,394,1049,1281,527,582,556,181,295,1059,285,232,2113,2068,124,205,182,643,1156,562,2304,2082,286,585,299,354,1045,211,401,1104,4104,4112,4128,4099,185,1061,396,344,586,645,1282,593,535,240,1050,206,95,327,564,800,2072,2084,402,356,2055,2177,307,301,417,1160,213,1066,568,1120,832,588,4101,4160,4105,4102,1035,1537,186,646,404,1091,227,896,594,418,302,649,2114,2560,771,360,539,111,1052,331,1168,214,2059,2088,309,1062,1284,188,449,1073,217,408,609,596,551,650,229,159,420,310,1093,541,2116,2178,4113,4106,4114,4224,1288,773,610,657,333,1065,119,1098,600,339,1184,218,368,652,1031,230,391,313,450,542,1538,334,2067,2061,2096,2062,1076,233,555,774,175,123,1155,658,2120,2305,612,341,777,220,314,1105,424,1068,395,673,583,355,4108,4129,4161,4116,1296,1094,287,183,234,1051,2069,2180,125,557,1216,660,616,342,2083,2306,316,1157,241,778,563,1074,345,452,397,403,1112,207,2074,2561,1540,674,558,785,1100,432,1039,357,187,1162,236,664,1312,624,587,780,1080,1122,2128,2085,705,126,242,1063,2073,2070,565,398,346,456,2184,2308,358,405,303,569,1544,244,1158,1097,595,1283,189,566,676,1169,1054,1108,361,706,4352,4130,4120,4132,589,1344,215,786,647,348,2312,2086,419,406,2562,2144,464,680,2115,2089,801,1069,362,1164,2192,2076,590,409,1286,570,1121,788,1552,1106,597,1075,572,1186,219,311,4103,4225,4162,4608,708,598,1289,601,651,421,792,802,2117,2090,611,1047,602,1172,410,231,688,653,2564,2097,1128,248,1070,369,2122,2320,190,364,1568,654,1095,659,1161,335,480,315,221,370,1285,613,4107,4136,4164,4226,1408,422,2208,3074,425,451,2568,2336,4115,4109,4144,4110,1077,614,543,1298,235,412,343,372,2576,2240,1185,775,317,1539,222,1099,426,453,237,1124,559,1170,2592,2118,1292,833,804,712 ,1082,834,661,1053,2092,2179,2129,2098,808,779,1217,617,604,1541,433,720,816,1101,2121,2063,1176,836,347,897,4168,4353,4117,4228,1136,243,1297,662,1600,454,318,675,2368,2181,1110,618,4131,4354,4122,4609,1081,898,781,1314,1220,376,428,1546,2100,2071,665,736,567,1107,2182,2432,1192,1078,2124,2185,840,625,238,1159,359,457,399,787,2130,2104,591,678,434,677,1290,1542,2075,2145,349,1300,1102,245,1188,458,666,1113,620,1553 ,4176,4133,4121,4118,1163,1313,363,127,4232,4356,4360,4134,1067,191,1125,782,407,436,2087,2307,626,1218,2132,2186,571,465,2193,2309,681,246,707,1346,2077,2091,2146,2563,350,1084,599,668,1548,790,2136,2188,1165,1320,460,1123,1200,249,682,1664,573,1171,411,803,4610,4192,4163,4137,1116,789,1304,709,365,440,628,689,2078,2194,374,1224,3076,2119,423,1556,4240,4124,4165,4138,466,793,2310,2313,2209,2624,1130,250,371,1174,2093,2148,481,574,1348,413,1109,603,366,1545,1287,1055,468,1570,655,900,805,615,1166,684,1409,710,2688,3073 ,1187,429,4612,4145,4170,4368,2099,2196,794,252,1114,373,605,1232,848,690,2094,2123,713,632,2314,2321,1316,482,806,1132,2565,2152,1083,427,1177,904,1569,414,2210,2101,1291,223,1126,1554,663,692,835,1328,619,472 ,2241,3080,1137,455,4256,5122,4616,4384,4624,4288,4640,4166,2200,2125,796,1189,1601,809,714,1248,721,837,716,1086,2212,2816,1302,1352,4140,4227,4177,4146,864,810,1173,606,1194,912,1103,722,696,377,2316,2322,1424,435,2566,2102,1293,1560,817,1129,1792,319,621,1180,2131,2105,2569,2160,812,484,1345,430,1572,1138,3072,2183,4169,4111,4416,4229,1299,838,667,1219,2126,2337,488,1111,239,378,459,622,4148,4119,4230,4480,1410,627,2242,2133,437,380,1201,1608,818,1178,2324,2570,1294,461,1543,496,669,1190,1317,679,2106,2216,1140,1079,4172,4233,4178,4152,2187,2147,1221,724,841,1305,629,1584,2134,2108,351,467,2328,2137,1360,438,1115,73 7,2338,2577,251,462,442,441,2572,2244,1666,469,1549,247,683,1196,2189,3088,2149,2195,4123,4193,4135,4355, 1226,842,1412,1127,738,1144,2224,2190,4180,4234,4241,4357,1308,899,1602,670,1318,783,1085,849,4125,4139, 4194,4611,1555,1193,820,1576,728,928,791,367,2578,2369,1376,901,2079,2248,2138,3104,1233,630,2593,2340,1 321,685,844,1204,633,711,2370,2580,2311,2197,2150,2153,1118,253,691,1301,824,1175,2352,2344,902,686,1668, 1222,1416,1133,740,1347,4184,4236,4126,4242,850,375,1558,444,5124,4167,4358,4361,1306,470,1167,483,4257, 4672,4141,4196,1547,415,3078,2211,485,905,2140,3081,4736,5121,4147,4244,1202,795,473,1240,2095,2315,634, 744,2433,2594,1616,852,2372,2256,2434,2198,960,1322,2201,2213,865,693,2154,2103,1131,1794,1350,797,1225, 1604,1571,906,2376,3136,1252,715,1141,1330,807,474,636,1179,694,254,4142,4171,4362,4369,1550,1665,2584,2 625,717,1071,2596,3082,1315,575,913,1440,798,811,379,1208,4613,4200,4258,4149,2161,2202,1353,1191,2127,2 317,697,1564,4289,5128,4248,4173,431,1142,607,1228,2156,2626,489,1324,2272,2214,866,723,2567,2600,486,15 73,1181,1234,908,1793,1561,718,813,1364,2243,2318,476,856,3089,2689,1117,1411,4260,4864,6144,6145,839,13 29,1295,1146,4364,4370,4614,4150,3084,2571,725,698,1472,914,2323,2628,1249,752,868,819,1349,814,439,929,4 179,4153,4617,4208,2339,2107,1197,1578,490,1139,2217,2608,1680,623,2162,2325,1632,1336,671,1198,1362,739 ,2204,2135,1603,1557,3200,2245,5120,4231,4174,4385,2164,2218,1413,916,1303,463,1236,843,2109,3090,1135,3 81,1672,1354,2579,2573,4290,4181,4372,4618,4154,4264,4235,4195,497,1586,930,821,2690,2329,726,961,1203,1 182,2326,2574,872,1418,492,1250,1332,631,2225,2341,4182,4156,4376,4185,2436,3105,1574,1223,729,1145,1605 ,700,2139,2632,1796,443,2817,2246,1307,741,2220,2168,1378,1562,1356,1205,845,1319,4386,4625,4620,4292,22 49,2384,920,382,2110,2330,1585,822,1425,851,2191,3077,3092,2151,1229,730,1609,498,2226,2342,4237,5136,41 97,4243,880,1256,742,445,1392,471,2141,3106,4272,4238,4626,4417,2692,2250,2640,2371,4127,4296,4186,5152, 635,1148,1696,932,1580,687,2440,2345,1210,1420,1612,1325,1800,903,1134,825,4641,4388,4418,4628,1235,1361 ,500,1577,846,1670,1195,745,2818,2155,2228,3328,4359,4245,4198,4201,826,732,2199,2257,2332,3075,1264,446, 2696,2142,962,1426,1620,936,2252,2346,1377,475,2448,2656,3137,2400,2373,2581,853,1310,867,637,2203,2258, 1551,1230,2353,2595,1414,907,1206,1667,1588,1333,4400,4392,5126,4259,487,1808,2348,2157,4188,5129,4143,4 363,695,1441,1087,746,4481,4642,4420,4304,828,753,1610,854,1237,1326,3096,2232,4482,4246,4249,4261,4202, 4151,4424,5184,857,1368,2582,3108,1209,504,799,1355,2585,2163,255,964,4632,4673,4644,5130,3138,2215,2273 ,2374,1242,909,2354,2820,2205,2704,1673,1559,1309,719,2377,2158,1143,477,2165,2260,1617,915,1448,1380,22 19,3086,638,748,2824,3112,944,1728,1331,1227,869,1592,1428,491,699,1253,4209,4250,4175,4365,1351,754,237 8,3201,6146,6148,4204,4674,1183,1565,2274,2597,858,1618,1417,1476,4320,4262,4615,4648,4291,4366,5137,473 7,3091,2586,478,968,1260,383,2435,2356,5132,4619,4371,4676,1212,910,1801,815,2264,2464,1579,976,2319,232 7,870,1684,1633,917,2206,2385,2598,2720,3140,2166,1337,1241,2380,2627,1606,1824,727,1150,1442,493,1357,1 251,2588,3120,1676,873,2437,2221,1384,701,4387,4155,6152,6160,3085,2169,1566,931,4265,4656,4210,4373,132 3,1798,1365,1473,2601,2247,756,1334,860,499,2832,2227,731,1648,1238,823,4252,4183,5248,4293,1575,922,119 9,1674,4212,4266,4157,5138,2276,2386,874,1432,1421,918,2360,3584,4627,4621,4738,4377,2752,3202,1636,1254 ,2438,2222,502,1795,2602,2629,933,1366,4374,4622,4273,4389,3094,2441,1338,1682,2331,2170,2496,2401,1587, 1211,1488,743,1358,760,2609,3144,1244,1581,881,1147,4484,5153,6176,6147,2251,2111,494,1379,4187,4680,486 5,4294,1272,702,2388,2442,3097,3329,921,1624,501,876,2575,2630,1415,847,1856,1444,992,1697,2604,2229,426 8,4216,4297,4432,2343,3107,2333,2280,447,1607,1436,1369,2172,2253,1257,1704,2230,2691,733,1797,3204,2610 ,1669,1340,1231,827,1590,934,4158,4378,4239,5125,2334,2633,1634,1474,5140,4199,4274,4390,2347,2402,3093, 2259,882,937,2449,3152,2233,3109,963,1419,747,1265,2444,2392,4189,5154,4740,4298,4688,4419,4488,4393,111 9,505,1381,855,2634,2693,924,1810,3330,2641,2583,2288,6149,6208,4866,4203,3098,2254,734,829,1563,1213,21 43,2375,4276,5376,4247,4305,1611,1363,2612,2848,1430,1258,1688,1386,965,1614,1730,1239,2450,2404,938,884 ,4380,5123,4744,4190,506,1327,1589,1804,2355,2349,2465,3208,749,1370,2261,3114,4300,4394,4496,4704,2616,
3168,1640,945,2880,2636,966,1456,1681,755,3083,3585,2234,2694,1266,859,5185,4448,4421,4629,2452,3139,227
5,2944,4251,4306,4401,4643,2642,2466,1427,1593,1388,940,2350,2697,1214,830,2819,2408,4396,4205,5144,4280 ,1809,911,1621,1582,4630,5156,4633,4211,2587,2159,1832,871,3100,2379,639,1480,5186,4263,4321,4422,1698,1
335,888,1372,1245,479,1422,1268,4402,4868,4253,4752,3216,2262,946,1732,2357,3110,1677,750,1802,1626,3332 ,2236,4425,4206,6153,6150,4213,4308,4267,5134,2497,3121,1393,969,2265,2456,2657,2644,508,1613,2599,2698,
4872,5160,4426,5249,2277,2207,861,1446,2468,2358,1857,1339,3141,2589,757,1382,3336,2821,970,1700,2658,27
05,2381,3113,1243,919,2167,3146,1594,1433,1826,1504,875,1635,1259,862,4322,4645,5139,4634,2648,2387,1920 ,1675,4483,4404,4312,4512,4367,4375,6161,6154,3232,2266,1445,758,4254,4433,4646,4768,2416,2700,1149,948,
1359,1816,3079,2278,1596,1671,1712,977,5188,4214,4428,4675,4636,5168,4485,4269,5133,4217,4649,4295,2439,
2361,1385,923,1622,972,2498,2590,1434,1311,3586,2382,4880,4275,4324,4434,1729,761,1396,877,3124,2281,260
3,2822,2223,2171,3203,2706,1207,1475,2660,2389,1449,1812,952,1686,2825,2268,495,1262,2362,3153,1644,1619 ,2472,3116,1341,1429,2443,2721,1825,703,6162,6272,4408,5632,1371,1638,1567,1736,4800,5250,6156,6177,2631 ,2403,935,1685,978,1625,3344,3142,4486,4270,4650,4677,883,762,1246,503,5142,4489,4379,4218,2335,2231,145
8,925,4544,4449,4657,5192,4299,4159,4436,4490,1394,1269,2282,3099,5145,5377,4623,4678,878,1478,735,1799,
4652,4277,4391,5155,2173,2605,3264,2708,2664,2390,1678,1860,2364,3205,2289,2826,2611,3122,1443,1637,438
1,4328,6209,6164,2393,2500,1481,1373,2445,2451,3160,2255,1699,1255,993,1591,1828,1452,3588,2722,885,939,
994,1400,2606,2833,3148,2480,4220,4301,4278,4739,1744,1656,3087,2405,5252,4658,6400,6178,2235,3210,980,1
689,926,764,2284,2712,1270,941,1628,1367,1805,1457,3360,2672,4382,4681,4395,4450,2635,2828,3128,3170,514
1,4307,4497,5200,1921,1583,2753,2174,1387,1642,2290,3111,967,1267,2613,2446,4281,5157,4492,4440,1484,145
0,2394,2504,4682,4741,5378,4689,886,831,1683,1342,4631,4336,5146,4302,1811,947,2406,2453,2351,2617,3592,
2292,1705,1431,3206,3145,2643,3331,507,1261,1840,889,2237,2614,4191,4423,4660,4896,1650,984,1760,1490,61
68,6180,4498,4452,2724,3217,3102,3156,1615,751,2409,2754,2637,3392,2263,2834,6151,6273,4403,4397,1702,94
2,1858,1423,2695,2396,1460,1383,4513,5256,4309,5162,2467,2454,996,1692,1641,1814,971,1477,2512,2728,1273 ,1512,1733,890,1598,1374,4664,5216,4928,4684,2849,3117,2410,3212,509,1806,2638,2457,5131,5633,4282,4742,
3334,2618,1922,1649,4500,5187,4323,4992,3169,2836,3600,3154,949,973,2645,3123,2620,3234,1397,1489,4690,4
514.4398.4745.2267.2359.2756.2646.6210.6656.4867.4456.4635.4207.5148.4427.3337.2649.1708.1627.2699.2469,
1000,1690,2840,2850,892,1274,5264,4310,6155,6184,2659,3095,1438,1817,2650,3220,2458,2279,4405,5158,5380,
4284,1390,1464,2736,2701,1868,950,1151,1731,4545,5169,4313,4504,1506,1827,1597,863,3176,2296,3118,2417,4
705,4692,4647,4746,1451,759,2238,2412,1864,1714,3616,2702,3143,2707,1701,1395,4325,4255,4516,4406,5189,4
637.6212.6274.3209.2383.2528.2363.1803.1008.2269.2418.3333.2661.1623.1482.5384.4869.4706.4753.3456.2470,
1276,510,4429,5161,4215,5194,2473,2499,1435,1652,4696,4435,5280,4314,3125,2662,2591,3346,2283,2460,2391,
2420,979,1492,3233,2823,4464,4748,5127,4326,953,1928,1829,1389,4487,4409,4546,4638,2365,3587,1738,763,22
70,3147,1872,974,5634,4430,6163,6157,6192,6158,5172,4329,2474,2501,1453,1643,2285,3172,1713,1818,4651,48
70,4271,4219,1215,1402,2607,3218,1629,1520,1830,1691,3340,2881,954,1459,5251,4754,6216,6401,4708,4437,48
73,4316,4410,5201,4520,5164,1734,879,2852,2760,3130,2882,981,1505,2709,3101,1706,982,4491,4769,4679,4451 ,2856,2827,3265,2665,2652,3589,2481,2768,2864,3149,1924,927,3224,2884,1833,1639,2395,2945,3184,2291,1447 ,1746,3345,2710,1343,1679,3648,2502,2366,2723,1820,1761,5392,5190,4383,4279,4330,5147,6165,6276,1479,127
5,995,1740,4221,4653,5312,4756,4712,4438,6179,6402,3158,2666,1401,1888,4412,5253,4337,4874,765,956,3129,
2946,2829,3362,1496,1861,4659,5170,4441,4548,3268,2424,887,1437,4493,4499,5208,4303,6170,6657,5636,4770,
4654,4881,5196,4528,985,1720,2476,3594,997,1630,1813,1462,5135,4453,4283,5258,2713,2784,2615,3155,4332,4
760,5408,4720,3240,3126,1398,1645,2888,2673,2286,3207,2407,2505,2447,2835,1848,1687,2639,2726,46
83,4876,
5176,5218,1247,1716,2482,2725,3338,3590,1936,986
,1483,1651,1745,943,2397,3348,1859,1508,3150,229
3,3236,2
506,6224,6181,4801,4222,1834,1454,2714,3161,4338
,5159,6169,6166,2668,3601,891,1841,998,1595,3211,
3361,46
61,4494,4442,4552,1278,766,1465,1709,6280,6404,4
454,4501,4399,4665,5640,4340,2411,2175,1764,1646
,5254,51
93,4691,5379,4285,4662,4772,5265,3115,2239,3173,
2830,2455,2484,1737,511,5150,5204,4457,4802,2674
,3266,14
85,1404,4685,5440,4311,4882,2619,2513,1693,1866,
2729,2294,2755,3394,4743,4444,6408,6182,1952,149
1,988,16
57,4515,4502,6658,6240,1752,1807,2398,3132,2647,
2716,3596,2838,1399,1844,3213,3368,2508,3171,100
1,951,16
54,1926,3248,2297,2730,3712,1707,1391,4560,4776,
6211,6185,2621,3219,2459,2851,4897,5165,4458,526
0,1002,1
468,3164,2837,3352,2757,2413,2488,6288,6172,4686
,4505,1836,1494,1873,1271,2676,2737,1694,893,538
2,4666,5
217,4884,2422,3272,1923,1461,2471,3604,1748,1715
,5648,5202,4693,5171,2514,2841,975,1862,4668,528
2,4315,4
407,894,1815,3178,2298,2419,3222,1497,1653,4804,
4694,5385,4697,4747,4517,4888,4898,6213,6186,470
7,5143,2
529,2622,3396,2461,4698,5268,4506,4327,3157,2651
,2414,3593,1510,1762,3335,3103,2516,3618,1842,13
75,2703,
2948,2853,2663,4784,4749,6660,6193,3214,2732,170
3,1009,5224,4344,5166,4465,3457,2758,1466,1874,6
218,641
6,4286,4460,3235,2477,955,1739,2842,2300,3162,24
21,2653,3280,2896,2738,5664,4750,5191,4755,1486,
1930,276
1,2680,1889,1004,1658,1821,5257,4431,4576,4411,1
718,1929,3364,2530,2854,3180,1599,1507,3131,2475
,1776,14
05,3225,2952,3617,2462,4317,4466,5381,4709,1735,
1831,3339,2271,3174,3602,1493,1010,5504,4518,630
4,7170,4
521,4547,6664,6432,2711,2740,2883,3376,5173,4710
,4639,5394,1984,1455,2667,2520,4331,4508,4439,44
68,957,1
865,3185,2503,6672,6336,5281,4871,2844,3237,3649
,2857,4413,5635,4318,5195,4522,4549,4333,5220,27
62,3296,
2769,2885,2764,3134,983,1710,3350,3400,958,1514,
4655,5266,6688,6214,2912,2858,3221,2654,1876,176
8,3242,2
960,5388,4929,4900,4808,1721,1938,3151,2770,2744
,2425,1660,1500,5178,4930,4757,5149,6188,6275,62
25,6194,
1403,1892,3472,2483,1819,1741,1516,987,4904,4875
,5313,4713,3341,3608,1932,1463,2865,3177,3840,23
67,1012,
1843,2669,3228,4700,5637,4529,4816,4912,5197,621
7,6159,5272,4932,4443,4993,1749,999,2860,2532,33
93,2478,
3620,3186,5232,4339,5393,4758,3347,2886,2715,326
7,5696,4550,4414,4771,1838,1277,2536,3159,6464,6
277,520
6,4714,2287,2426,2507,2670,3458,2675,1647,1925,2
485,2428,1498,1742,5177,4994,4877,5410,3249,3656
,2866,32
26,5316,4472,4524,5642,6196,6167,4761,4832,1513,
1880,1717,1016,4663,5203,6278,6528,5288,5174,622
0,6281,1
953,1837,3342,2509,1867,1631,3591,2544,4936,4721
,4334,5255,2717,3238,1469,1747,3365,2727,767,190
4,4455,4
553,4495,4883,1724,1524,3188,3127,6226,6200,4687
,4774,4530,4773,5386,5638,6171,6241,4445,5396,98
9,1406,1
754,1822,3269,2772,2889,3353,5198,4341,5284,4554
,2677,3632,2399,2515,4762,5209,4716,5649,3408,24
86,3163,
2785,2299,2510,2490,2489,1835,1499,3714,2517,359
7,2295,2731,3244,5259,5409,4459,4223,1944,1863,1
890,146
7,1003,1522,3274,2890,3460,3175,2786,3192,5163,4
287,5221,4878,4503,4532,6183,6403,1763,1695,3356
,2947,47
22,5314,6228,6282,4667,4561,6289,6405,3650,2718,
1850,990,4777,4342,4803,5442,1005,1937,3366,2831
,3133,28
97,1722,1845,6173,6187,6242,6659,4446,5180,4695,
4764,3603,3241,1495,1655,5644,4886,6232,6284,526
1,5416,4
556,5219,5296,4345,4778,5760,2868,3624,2776,2976
,2839,2415,1765,1956,4669,5267,4507,4899,3424,29
49,1487,
1750,5212,4885,5400,4805,3281,2678,1869,1521,336
9,2733,2892,3252,4461,4536,4724,4785,2681,2759,9
59,1896,
6174,6290,4470,5320,1263,1940,3166,2301,2739,334
9,2872,3223,1770,1877,2950,2734,3716,3270,1509,1
711,346
4,3181,2788,3395,7172,6215,4519,5652,1756,1846,2
898,2423,4562,4889,6406,6409,3606,2492,1011,1960
,3354,25
18,3215,2531,6305,6720,5226,4346,4467,5270,6189,
6244,3595,2463,1784,1870,4577,4670,5444,4509,520
5,4699,4
462,5641,1662,1013,2533,2953,5383,5151,4564,5666
,4751,4996,4901,4711,1985,1753,3250,2843,5262,47
80,5505,
4806,2521,3288,2682,2792,6784,7169,5283,4525,192
7,1528,3664,2900,6195,6292,4890,4348,1849,1882,3
008,337

0,5210,4469,4701,5328,4944,4786,6190,6219,2913,2741,1766,1511,4809,4728,6410,6417,3179,3842,3398,2845,3273,3652,3619,2954,1954,1719,3300,2763,3189,3378,1777,895,5412,4578,4902,5228,2855,2522,2684,3227,6661,6248,5179,4523,2742,2302,1439,1006,5273,5000,5665,4510,3598,3713,1878,1891,2765,3119,3363,2623,6306,6197,5387,4319,2961,3488,2846,2859,2427,3256,1939,1661,5222,5650,4759,4788,3401,3239,1502,1986,2745,3612,1852,1934,4931,5424,4715,4568,2479,3190,2655,3276,6337,7176,5233,4551,2537,3372,1723,1772,2914,2771,1515,1897,6296,6221,4892,5285,5697,4905,4810,5344,4817,4933,4812,5182,6308,6912,5398,5448,2534,3621,3229,3282,4960,4906,5269,4702,2956,3841,3609,2766,1014,1470,2861,3412,5290,5008,5199,4818,1743,1931,2524,2904,4792,4473,6412,6418,3165,3459,2887,3377,5520,4531,6662,6198,3343,3194,2773,2746,5389,5656,4913,5225,3520,2962,1017,1968,3297,2800,2916,2867,3397,2862,2487,2977,5888,4415,4717,5276,1881,1894,3245,3626,1769,1517,2538,3187,6227,6201,6665,6256,1778,1941,1823,1659,3728,2671,1992,1875,4908,4580,5441,4526,3680,3384,1755,1501,2719,3246,3410,2787,5668,5234,7168,6279,1018,1900,3651,3605,1725,991,3461,2964,5395,4934,4763,5315,6222,6433,4584,5207,4335,4474,4555,4718,3351,2511,3284,2891,5506,4723,6338,6229,4533,4476,5297,5704,4914,5274,6420,6666,3183,2429,3720,3402,5390,4557,5639,4592,2545,3634,2978,2869,4765,5286,5413,4775,6202,6312,5236,5175,2774,3009,3251,3230,1933,1839,2920,3466,2540,3298,3380,2679,6283,6243,5317,4820,1525,1955,1988,1884,1726,1948,3622,3271,4937,5401,4725,5680,6230,6204,4447,4563,2777,3193,3653,2748,6424,6233,5456,4534,5211,4833,6434,6673,1780,1518,3844,2491,1020,1767,1905,1851,4347,4558,4538,4537,3355,2789,1893,1945,3426,3610,3404,3253,2893,3367,2968,2430,6668,6340,5762,4565,5645,4343,4779,5292,6285,7184,6245,6291,3633,2870,3473,2899,5322,4938,5508,5223,3277,2778,3657,2546,4834,5240,6320,6286,1757,1530,2928,3304,5404,4995,5698,4766,2790,2493,3440,2519,5414,4879,5181,4945,1958,1471,1007,2000,2683,3196,3744,2980,3628,2735,1847,1898,5651,5289,4916,5672,4824,5024,4887,4463,6674,6465,5472,4997,3258,3468,3660,3373,6175,6344,6234,7200,5329,4726,6689,6436,1523,1942,3848,2951,3182,2873,1961,1871,5417,4781,4940,5300,3283,3409,1771,1529,2548,3625,2894,3718,4729,4807,6466,6676,6407,6293,6246,6249,3243,2793,1912,1758,5214,4349,4787,5397,4920,5271,6448,6440,4998,4782,5764,5318,2874,2780,1989,1946,3312,2494,3010,3474,5512,5229,4836,5443,3668,2984,3425,2523,4946,4471,5654,4540,1526,1906,2901,3358,2915,2685,3599,3278,1883,1773,3462,2955,5402,4566,5263,4579,3254,3715,3636,3381,2535,3856,1957,1853,2743,3489,3135,2794,5643,4511,7174,6307,4581,5001,6236,7177,1976,1015,2876,2801,5298,4891,4569,5336,6191,6411,4730,4840,3658,2902,3285,3374,6529,6690,5712,4948,6468,6352,6530,6294,1751,1993,1503,1962,5056,5418,6297,6309,4961,4789,6250,6199,2905,3416,3257,2552,5227,5890,5446,4893,5321,5700,5667,5002,6472,7232,5348,4811,2847,3403,2303,3012,5237,5426,4903,4570,1781,1885,3290,2957,4732,5275,4790,4350,1908,2016,3721,3607,5646,5761,6680,6721,3357,2767,3191,2525,4813,5167,6692,7178,5411,4671,5009,5536,3665,2963,3496,3428,4894,4907,4475,5304,2686,2796,1854,1532,2992,3776,3379,3275,2917,3640,3476,2539,2747,3301,1972,1774,6257,6298,5449,5287,6223,6413,4793,5660,3399,2802,1019,1895,4527,5238,4703,5324,3231,3613,2906,3666,6252,6722,4585,5420,6368,6310,4962,4819,3465,3524,2526,3016,6663,6696,4582,5669,5277,5330,5004,5889,3308,2431,1987,1969,5657,4814,4909,5460,6339,6414,4572,4952,3260,2958,3849,2863,7185,6785,5213,5507,3627,3024,1782,1279,4935,5425,5391,5242,2918,3732,3681,2965,7180,6667,4821,4794,5568,5010,6419,6724,5345,4848,4964,4915,5445,4910,4535,5025,1943,1899,3385,3289,6435,6203,5293,5674,1994,1663,3654,3872,2775,3198,3490,2541,4586,5235,6313,6704,3405,3299,1964,1785,5776,4719,6258,6421,3724,2921,1021,1935,5728,5432,4767,5294,3432,2749,3614,2979,5458,4835,6300,6231,3371,3846,3413,3521,2804,3382,2908,2547,5699,5653,7296,6341,2779,3696,3286,2871,3623,2970,3247,3722,6260,6314,5509,5012,1886,2001,2922,3480,3469,2966,1407,1779,5399,4559,5332,4939,6205,7186,5231,4477,1990,1970,3684,3302,5768,54
50,6675,6669,2550,3843,1879,1022,4593,5682,5026,4917,6786,6425,4822,5057,5299,5278,6422,6670,4968,5514,4
588,5346,5428,4727,6321,6437,2981,3414,1902,1947,6532,7201,5670,5319,3386,3730,3635,3259,4825,5241,5701,
4796,6235,6728,5892,4539,3536,2791,3406,2808,6913,6342,5403,4837,3292,3629,2929,3195,6316,6264,5474,565
8,5452,5301,4941,5415,2542,3427,3320,2750,2969,3672,2549,2924,1759,1907,3463,2895,6345,6480,5016,4478,39
04,3492,3040,3745,1527,1996,1786,1959,6206,6426,5681,4918,5521,4947,6287,7173,2495,3655,3484,3417,7188,6
247,5325,4826,2002,1913,3305,3752,1949,2017,2781,3845,5705,4594,6322,6438,1534,1788,3717,3388,3279,2875,
3638,2982,4976,5352,4838,4541,5488,4567,6237,7202,6788,6346,6736,6467,3682,3522,2930,2985,4731,5244,579
2,5028,5676,4783,6536,6441,5306,5516,5708,5421,5896,4999,5230,4921,3011,3467,2795,3313,5331,5457,4596,56
73,3167,2553,3429,2903,4942,5766,5291,4841,6914,6251,6324,7424,2972,3858,1910,1965,2782,2877,3611,3261,3
659,3411,2004,1901,4922,4828,6295,6353,3478,3306,3736,3434,6428,7171,5360,4542,6792,6238,5058,5522,3013,
3662,3778,3287,5716,5032,6348,6442,5473,4571,6544,6752,1966,1775,2986,2932,2008,1531,2554,3375,7233,649
6,6469,6677,3637,3852,1971,1950,2797,3418,3688,2993,4949,5406,4963,4733,3014,3504,3729,2803,6299,6354,56
47,5326,6449,6691,5510,5003,5302,5763,5684,5429,3314,2907,1909,1991,4583,5904,6444,6253,3475,3641,3436,2
988,4791,5537,5183,4842,3262,2878,3857,2959,4924,4849,5706,4950,5333,5422,7192,6328,3669,3630,3880,2919,
2018,1727,2687,3528,3746,3383,2936,3420,4953,5464,6678,7204,5305,4600,4895,5451,6681,6259,4351,5060,329
3,2527,3470,3316,7234,6311,6369,6470,5338,5005,6450,6916,1916,1855,1974,1995,2994,3780,3725,2798,6301,68
00,5769,5655,5405,4815,6473,6254,3850,3674,3441,3017,5239,4573,6261,6356,5713,5011,5544,5476,2020,1977,2
556,3661,6315,7182,4734,4844,6920,7208,5040,5824,5427,5323,4965,5688,2909,3494,3905,3387,2805,3430,3018,
3748,5524,4587,4795,5349,3291,2967,1787,1914,5447,4850,6474,7297,3642,3481,3874,3552,5279,5661,6370,669
3,2923,3683,3307,2910,4954,5714,5513,5572,2005,1887,3968,3723,1023,1963,3493,2806,7187,6682,4574,5064,53
56,4479,6531,6452,3197,2996,3407,3864,5308,5006,5897,4911,6360,6560,5675,5072,6415,6423,4966,5780,5729,5
013,6302,6481,3644,3719,3760,3025,6694,6816,7236,6262,5433,5337,6476,6723,3433,2971,3670,3020,5702,5920,
4823,5246,5538,4589,5453,5347,6684,7216,5772,4969,3482,3359,1998,1783,6533,6317,5480,4797,3777,2809,344
4,2925,7181,6265,5662,5027,2024,1980,3255,3523,5419,5894,5461,5569,6697,6343,4852,5430,4956,4595,6928,63
23,4827,5744,5334,4919,3497,3860,3000,3734,5671,5018,5295,5770,2543,3310,1903,1973,3692,3667,3389,3477,3
873,2751,3419,3686,6372,6482,4970,5528,5517,5014,6456,7680,3615,3784,2983,3733,6848,7298,5732,5350,3026,
3673,2931,2810,6534,6318,4598,5891,6698,6725,5029,5462,3294,2551,3506,2973,7190,6537,5434,5778,6427,626
6,6592,6497,3442,3317,2003,1789,5683,5307,5584,4839,5454,4856,6705,7240,2926,3526,2783,3847,5340,5677,49
77,5243,1997,2032,3726,3908,6347,6207,4590,5475,5368,4798,6484,6538,7193,7425,5017,5720,4597,4972,6671,6
726,5511,4943,5952,5540,5088,5793,6700,6325,1978,1917,3491,3685,6439,7203,6429,6376,2010,1519,3529,3421,
4543,5703,5532,5465,6268,6349,5353,5800,3747,3303,3041,3639,6326,6787,4829,5893,3876,3500,2933,2987,730
0,6706,5765,5436,5327,4923,5686,5030,3042,3448,3792,3704,3028,3737,2974,2812,6430,6729,5730,5570,3318,29
89,3676,3415,3853,3505,2019,2006,6443,6498,7189,6355,3969,3631,3435,3690,4978,5033,6545,7248,6329,7205,5
059,5515,1951,1911,3015,3315,4843,5361,6540,6488,3532,3498,2021,2009,5215,4601,5477,4951,6730,6789,5020,
5906,7426,6737,6679,6384,7194,6350,4830,4925,5659,5309,6239,6471,2934,2879,3731,3390,5707,5459,6708,694
4,5526,5354,5784,5482,5061,5710,5826,5335,6546,6500,5034,4980,3859,2995,3753,3479,4602,5423,5685,5900,25
55,3309,3888,2937,6451,6445,6561,7304,4845,5466,6357,7210,3698,3032,3808,3538,3663,2799,1790,2026,3750,2
990,3906,3471,6712,7264,5736,5041,3508,3431,3044,3740,6976,6732,5062,5552,5777,4851,7179,7681,3689,3862,
3019,3525,6330,6790,5362,4955,1975,2012,3321,356

0,3781,2938,3646,3422,6548,7235,6371,7040,1967,1915,2557,3854,3970,3697,2997,3021,6738,6562,5523,5689,5484,5036,6446,6793,5310,4926,6915,6504,5905,5007,5717,5678,6683,6255,5928,4967,7196,6475,4735,5576,5794,5431,4984,5468,5341,4575,5518,5364,3445,3537,3756,3675,7312,6358,5042,5828,6453,7206,5773,4846,5898,5722,7428,6332,3048,3738,2940,3322,3486,3865,3438,3512,2025,2022,3916,2998,6593,7217,5489,5065,6361,6552,6753,6740,4604,5709,6695,6794,3199,3779,3554,3875,6373,6303,4957,5542,6564,6454,5953,5435,3645,2911,1981,1918,2033,1999,3499,2807,7237,6685,4853,5478,7432,6917,5066,5796,3912,3762,3749,3443,6754,6801,6477,7209,3851,3056,3671,3530,5339,5015,6263,7242,5690,5529,5922,5600,4971,5731,5355,4958,3324,2558,3483,3700,6744,6483,6016,5771,3027,3540,3001,3976,7328,6362,5541,4854,3877,3437,3786,2811,6512,6796,5245,5044,5455,5912,7175,6374,5692,5767,5808,5073,2028,1533,3920,3022,3501,3691,3761,3866,6535,6457,5481,5019,5718,5068,6594,6686,5530,5407,7682,6478,3263,3450,3677,3568,5825,4857,5492,4973,7220,6377,6699,6918,3878,3739,3002,3507,6319,6267,7299,6802,5303,5571,6756,6485,3782,2927,3029,3553,5545,5908,5048,5782,6921,6364,4591,5358,2011,1982,3754,3030,6458,7249,5740,5715,6568,7212,5437,5525,6539,6817,5921,4799,3972,2975,3881,3687,3495,3794,2034,1979,5467,5734,5663,5832,3391,3727,3868,3809,6727,6499,5031,5781,5074,5721,7440,7238,4979,4858,5342,4599,3527,3323,3043,3788,6431,6327,5554,5021,3449,3936,2813,3004,5490,5365,6378,7195,4974,5574,4831,5895,3544,3909,2935,3485,6269,6701,7360,6804,6760,6486,5774,5956,6460,7301,6385,6922,6707,7218,5539,5733,3033,3768,3045,3678,6489,6596,5577,5469,6541,6547,7256,6351,3861,3510,2023,2013,5795,5351,5089,5687,5924,5548,7684,6818,4981,5035,5090,5496,3446,3693,2036,2007,6702,6929,7244,6576,3896,3735,3295,3764,5840,5752,7183,6501,6331,7306,5076,5785,5022,4860,6380,6808,5366,5037,5724,5463,5901,5553,7456,6768,3984,3034,3531,3699,6731,6924,7224,7266,3793,2991,3907,3556,6017,5679,6849,6270,3882,3502,2939,3889,5483,5738,6386,7207,5063,5363,6709,6542,5580,5546,6490,6600,3046,3643,3326,2814,4982,4927,5779,5438,3513,3757,3812,3694,5907,5043,6502,6549,6447,6713,7688,6388,5801,5527,7302,7241,6739,7427,4603,5357,2030,2014,3785,2559,5936,4985,6333,6710,3533,3452,3741,3914,5746,5080,5856,5586,6820,7313,7198,7252,5711,4847,6505,6850,6733,7488,6359,6930,5798,5038,5954,5519,6791,6492,5556,5479,2040,1535,4000,3539,6563,6550,5092,5788,5737,5910,5067,5573,6608,6824,5369,5608,5829,4986,5694,5470,3036,3705,3800,3855,6945,7213,6506,7308,3447,3892,3049,2999,4605,5902,6734,6553,3702,3974,3755,3439,3050,3516,3884,3542,7430,6714,6018,5745,3921,3319,3742,2941,7265,6932,7696,7250,3971,3509,3796,3763,5045,5069,6741,7219,6716,7330,5493,5585,2027,2029,3023,3910,6363,6455,6852,6742,2942,3863,2035,2037,7433,6745,5804,5723,6795,6565,5096,5786,6936,6946,4988,5370,6755,7191,5534,5913,6746,7316,6554,6375,5486,5560,6832,6797,5964,5046,5247,5827,5602,5923,5693,4959,7272,6392,7214,6513,3545,3701,3558,3810,5547,4855,6334,6508,5960,5810,7712,6798,7239,6803,5797,5491,3890,3423,3751,3057,3514,3922,3003,3787,3534,3978,3937,3052,7305,6479,6624,6459,5899,5104,6365,6514,7429,6757,5719,5578,3706,3869,3766,3977,7552,6566,5372,4606,1791,2038,3647,3555,3824,3453,3783,3879,6569,6595,5531,5748,3541,3058,4032,3503,7221,6758,6687,7442,6379,6556,6487,6516,5075,5588,7329,6919,5049,6024,5925,5485,6461,7683,5834,4859,6366,7243,5968,5070,6570,6597,5549,5739,6381,7268,5809,5914,3005,3913,3031,3758,5311,5498,6703,7314,5725,5616,5926,5787,7436,6977,5050,5555,3006,3562,3924,3816,2041,1919,3769,3986,5830,4975,6948,6856,7226,6978,5077,5601,6805,7197,5802,5078,3708,3548,3451,3940,6952,6923,7361,6761,6748,7685,6577,6864,3867,3789,3564,3035,6960,7245,6020,5023,7320,6980,5929,5735,3980,3511,3060,3891,6491,7041,7280,6387,3797,3047,3886,3325,5543,5842,7441,6806,5439,5775,7744,6598,6462,6819,5916,5857,3695,3973,3546,3790,5575,5371,5091,5836,3561,3928,3765,3064,7254,6762,5497,5984,4861,5052,7225,7042,6925,7458,5592,5957,7364,6520,4983,5533,4001,3885,3915,3679,5081,5816,6572,7 690,5093,5726,5909,5558,6809,6880,6711,7251,3517,3795,2815,3952,7336,7222,5494,5741,6984,6769,6382,7303,6503,6601,6543,6931,5944,5783,6735,6822,3772,3572,3037,3454,5343,5812,6578,6821,7434,7686,6032,5082,3802,3870,2042,2039,5579,5747,5841,5039,6493,7444,5955,5604,7246,6389,7332,6602,3883,3547,3992,3911,3938,3515,3051,3570,5930,5550,6810,7257,6764,7697,4987,5937,5094,5691,7307,7457,5374,4862,5561,5805,3811,3743,3898,3038,6507,6271,5860,5742,3053,3985,3770,3893,7211,6335,7269,6926,6551,6580,5833,4607,6770,7362,5581,5500,6715,6609,5789,5962,6825,6390,6851,7490,6048,5587,5084,5753,3543,3703,3813,4004,5848,5903,6494,7228,6743,6812,7692,6934,5495,5940,7309,7464,6604,7267,5097,5047,5750,6022,7344,6393,3535,3798,3917,3569,6826,7808,5803,5487,2044,2043,3007,3944,6717,7315,6555,6947,5098,5564,7260,6933,7448,6853,6509,6584,5932,5590,5969,5367,6772,6833,5790,4989,3311,3988,3818,3925,6518,7368,6019,5557,6567,7700,5844,5811,6610,6937,5071,5958,3557,3759,3804,3894,4990,5911,7274,6394,6515,7318,5593,5749,3059,4008,3832,3918,6625,6718,7492,6557,3710,3061,4033,3801,7253,6747,6510,7689,5606,5858,7431,7199,6612,7714,5938,5471,6799,7044,6949,6759,3975,3576,3897,3930,7310,6828,5799,5105,2031,1983,3814,3559,7553,6854,5562,5970,7331,6573,5051,5835,6938,6396,7258,6517,6749,7376,6992,6834,5582,6026,6857,6776,5985,5100,5754,5917,5814,6025,7460,6626,6950,7276,5695,5603,7227,6571,5872,5501,7321,7048,7713,6558,4002,3767,3825,2943,5831,5927,7435,6367,7270,7698,5589,5106,3487,3054,3926,3939,3987,3709,3550,4034,6807,6836,6979,7472,6080,5551,6763,6616,3900,3982,2046,2047,5053,5961,7281,6599,3771,3820,3563,3945,6940,7333,7745,6953,6858,7392,6865,6981,6860,7230,5079,5806,7446,7496,5054,5610,7008,6954,7317,6750,5972,5864,7338,7056,5817,6034,7247,6866,6840,6521,5756,5596,5499,5988,7568,6579,5915,5837,5612,5083,3062,3518,3791,3979,7437,7704,6028,5559,6961,7273,7936,6463,5108,5939,6765,7324,3065,4016,3929,3942,3817,3565,3826,3989,5845,5095,6956,6628,7489,6574,7716,7282,3871,3707,4040,3923,7443,6982,6811,7363,3803,3549,3066,3948,5934,5373,6632,7255,3773,3039,3981,3887,6383,6522,6603,6766,7554,6771,5743,6021,6581,6524,5594,5838,7345,7752,6962,7322,5609,5976,5813,5112,6049,5933,7438,6605,5963,5727,7687,6640,6813,7334,5565,5843,7461,6823,4863,6000,5820,5620,7284,7223,3573,4003,4036,3932,5085,5502,5850,5918,7365,6868,6985,7449,6773,7728,6495,6611,3774,3996,3828,3566,7504,6582,7259,6881,6395,6606,6586,6585,5931,5595,7810,6613,7693,6391,6827,7340,3068,3815,3953,3899,6040,5959,5986,5563,3941,3993,3805,3578,5099,5618,7370,6986,7556,7271,6882,7288,4006,3519,3055,4048,5859,5791,7452,7043,7746,6814,5946,5086,5101,6033,7462,6927,7229,6993,5818,5941,7699,7337,5591,5751,3895,3946,3571,3990,6964,7720,6872,7072,6935,6511,5861,6052,7520,7045,5583,5846,7377,6774,5965,5617,7465,6829,6988,7348,6777,6855,5055,5992,4009,3919,3819,3577,5359,6036,7262,6397,6835,7445,6968,7319,5866,5973,7046,6830,7812,7366,5605,5807,7560,7277,6884,7491,3960,3806,4037,3994,3574,3954,3931,3821,5852,5942,6994,6519,7702,6588,5107,6056,7450,6614,7311,6627,7691,6559,5880,5966,4005,3901,4024,3063,5758,5109,6629,7049,6081,5849,7346,6939,6617,7384,6778,6888,6023,5624,7760,6996,5945,5978,7104,7466,7009,6837,5862,5607,3799,4041,3551,4010,7275,7938,7494,6941,7369,7748,7715,7050,6050,5815,7396,6859,7285,7474,5873,4991,3829,3933,3956,4064,6951,6618,6780,7323,2015,2045,3902,3580,6838,6398,5535,5102,7694,7809,5974,5987,6861,7215,7459,6719,7057,7584,6942,6955,6523,7352,6035,5757,7497,7335,5598,6082,6841,7708,5948,6030,6575,7286,6751,7372,4020,3822,3067,3943,6633,7468,5819,5868,7010,6867,5611,5993,4035,4017,3830,3327,6630,7717,7325,7378,7052,7937,7705,6862,5110,5566,6957,7508,5839,6027,6620,7000,3991,3947,4042,3711,7261,7555,6983,7473,7439,7290,6869,6842,7616,7058,5113,6064,7393,6896,7012,6963,7493,6958,6583,7073,5977,5990,7341,7722,5865,5613,6634,7283,5874,6037,5919,5755,7824,6767,6088,5971,7776,7480,5851,5597,6815,7342,7506,6883,4012,3833,3069,3983,5114,5996,7747,7701,5821,5087,7557,7060,3934,4049,3455,3827,7447,6607,7380,6987,4038,4018,3927,3070,7279,6525,7816,7498,39
50,3995,3807,3955,6641,7730,7074,6965,6870,7105,7347,7326,6029,5935,7016,7562,6636,7394,7476,6775,5621,6
051,6084,5980,5822,6044,7718,7367,6873,7289,7749,6844,5876,5614,7940,6587,5116,5863,6001,5947,7451,6885,
5989,6041,7522,7706,7500,7349,6989,7463,7064,6526,3575,4044,3834,4007,7729,6966,7569,6995,7373,6874,775
3,6642,4050,3961,3997,4065,5853,5626,7024,7400,6886,6589,7536,6615,3582,3836,3958,4013,6054,5567,5103,60
96,6779,7292,7840,7076,7724,6831,5943,5994,7354,7564,7756,7469,5619,6038,7944,7047,7278,6969,6057,5967,7
379,7505,5867,5625,6644,7721,6990,7814,7339,6889,6008,5854,4052,3949,4014,3823,6970,6876,6085,6042,7408,
6590,7106,7570,7764,7080,7521,6619,5622,6002,6997,7454,7011,6781,7695,7374,5979,5869,7558,7051,4056,357
9,4019,3998,7350,7811,7732,7477,6631,7952,6053,5949,6839,7585,7231,6890,3957,4039,4066,3775,6072,5111,69
72,6897,7754,6998,7381,7470,5847,6089,5599,6058,7001,7512,7353,6648,6943,7499,6399,7108,5877,5981,7386,7
053,6004,6112,7817,7703,7453,6863,7287,6621,7761,7059,7592,7524,3964,3903,4022,4043,6782,6892,5950,5628,
7088,7872,7475,7371,7013,7736,7572,6635,6843,7397,6068,5870,4068,4025,3835,3962,4053,3935,3071,4011,749
5,6898,5115,5991,7327,7709,7002,7762,7561,7620,6622,7112,7404,6527,6083,6065,7356,7054,7945,6959,7723,71
20,5878,5375,7014,7828,7777,7061,6039,5995,7481,7385,6090,5759,7750,7968,6871,7294,7586,6637,7501,7395,6
060,5881,4046,3831,4072,4028,7820,7017,5117,6031,7528,6845,7710,7075,7467,7942,7509,7617,6900,7478,7004,
6643,6875,7792,7382,6967,7719,7066,7343,7818,5982,6097,7018,7576,7565,7062,5503,5875,6086,6066,7780,739
8,3951,4021,4051,3837,6646,7939,5975,5118,7077,7510,5998,6043,7482,7826,7731,7355,7632,6887,7502,6904,40
45,4080,4026,3965,7388,7725,7025,7291,6638,7523,7416,6846,7065,7768,6645,7020,5855,6003,7559,6991,8000,7
588,7136,7841,5623,6092,5882,6055,6591,7751,7580,7513,6098,6009,7401,7848,6045,6113,6877,7941,5630,5884,
7813,7484,7375,6971,7734,7078,4058,3567,4067,4054,7778,7618,7026,7081,3999,3959,4069,4057,7107,7563,689
1,7409,7263,6649,7525,6999,7068,7954,6006,6061,6878,6973,7707,7357,7755,7507,6100,5997,7574,7402,7832,75
30,7109,7758,7874,7383,6062,5871,7082,7028,6104,5627,6650,7471,7733,7948,6067,6046,6893,7514,7784,7089,7
110,7600,7825,6899,3838,4074,4023,4060,7410,7003,6005,6087,7571,7737,7532,7084,7358,6974,7953,7055,4015,
3963,4073,4070,7765,7726,7976,7015,6114,5823,6783,7624,7842,7479,7032,7516,7389,6623,7566,7412,6012,595
1,6070,6091,7090,7876,7821,6894,7946,7770,7537,7113,6116,6073,6652,7757,7005,7590,8001,7483,6901,7526,71
14,7844,7387,7063,5883,6010,7738,7577,7970,7648,7019,7779,7403,7006,4029,3966,4081,4047,6101,5983,8064,7
819,5119,6059,7589,6902,4076,3581,4059,4030,7293,7092,7503,7960,7740,7815,7856,7121,7529,7067,7766,7116,
7578,7455,6094,5879,7873,6905,7540,7021,6120,6076,7351,7619,7593,7956,7096,7830,6639,7406,5999,6069,778
8,7763,7485,7573,7969,6847,7515,7782,4082,4027,4071,4061,7711,7880,7079,7829,7122,7769,7027,6906,7390,66
47,7602,7069,7538,7413,6099,5885,7022,7622,6879,7943,6093,6128,7822,8004,6074,6013,7587,7781,6106,5615,7
625,7517,7843,7399,7137,7735,4084,4055,4078,4062,7972,7596,7029,7083,7138,7544,7888,7800,7124,7833,7070,
6908,7414,7085,7772,7511,7949,7601,6115,6102,8065,7727,7531,7786,6047,6007,7111,7411,7628,7594,6117,610
5,7030,6975,7827,7486,7955,7091,7849,7575,6651,7405,7984,7033,7794,7128,7904,7634,7759,6895,5886,6122,78
46,7086,8002,7567,7604,7527,7140,7836,7785,7958,7115,7621,6071,6108,7417,7656,7877,7034,7742,7518,6063,6
011,6653,7950,8066,7793,7093,7117,4088,3583,4075,4077,7541,7633,7852,7771,7144,7834,7036,7418,7582,7961,
7534,7608,6121,6118,8012,7094,7295,7875,7650,7971,7741,7007,6077,6014,6129,6095,7595,6903,8008,7858,784
5,7539,7947,7152,7767,7626,7420,6654,7579,7796,7123,7636,7097,8072,7973,7533,7882,6907,4083,4085,3839,40
86,6124,5629,8016,7118,7597,7787,7857,7962,7359,7546,7773,7664,7974,7835,7098,7603,7878,7023,7125,7649,6
107,6078,7850,7126,8068,7071,7977,7783,7591,7890,6130,6075,7487,7823,7964,7905,7623,7419,7139,7884,7545,
8032,6909,7100,4089,3967,4090,4087,7640,8005,703

1,7581,7129,7864,7141,7774,7957,7606,6119,6109,7
542,778
9,6132,6103,7992,7831,7391,7860,8080,7130,7627,7
795,7889,7087,8003,7652,7978,7598,7035,7985,4092
,4091,40
79,4031,7142,7739,7422,6910,7609,7853,7908,7790,
6126,6110,7881,6655,7629,7548,7837,8010,6136,563
1,8096,7
635,7132,7801,7896,7951,7543,7988,7145,7095,7798
,8070,7851,7535,7146,7612,7980,7638,8017,7415,78
38,7037,
8067,7605,7892,7859,6123,6125,7119,8006,7038,795
9,6131,6133,7641,7797,7654,7906,7986,7519,7847,7
153,761
0,8018,7099,7883,7630,8074,8033,7148,7802,7965,7
862,8073,5887,6134,7743,7651,7920,7549,7879,7975
,7637,71
54,8128,7599,7101,8009,7127,7854,7102,7658,8020,
7912,6137,6015,7865,8082,7804,7644,7547,8036,796
3,7885,7
660,7131,8076,7607,7156,7987,7893,7143,7982,7421
,7791,8069,7642,7886,7657,8024,7861,7160,8097,79
81,8011,
7775,7613,7891,6911,8048,7868,7668,7133,7550,789
8,7966,6138,6135,7979,7643,8088,8007,8034,7611,7
147,766
6,7907,7839,7994,7134,7149,8081,7866,7989,4094,4
095,4063,4093,7639,7799,7909,8100,7631,7894,8013
,7665,61
40,6139,7103,8040,7407,8084,7914,8021,7653,7855,
7900,7990,7155,8104,7928,8014,7806,7157,8129,789
7,8071,7
672,7993,8026,6127,6079,7910,7655,8098,7863,7921
,7039,7583,7150,8022,8035,8083,7805,7646,8130,79
96,8078,
6142,6143,7867,7916,7659,8041,7158,7614,7887,807
5,7161,8112,8025,8038,7913,7661,7922,8085,7967,7
803,813
6,8019,7899,7645,7162,8044,7869,7135,8077,7983,7
669,8099,8132,8028,7870,8092,7924,7662,7164,7911
,8049,79
95,8037,8089,7901,7674,8102,7615,7151,8144,7991,
8042,7667,8086,8105,8015,7915,7673,8056,7902,813
3,8090,7
670,8050,8027,7917,8101,7997,8120,7159,7895,8137
,7647,8106,7925,8029,8052,8160,6111,6141,7998,76
76,8116,
7918,7163,8039,8131,8113,7926,7423,8087,8043,813
8,7807,8108,7929,7165,8079,8030,8145,7551,7923,8
134,811
4,8023,7166,8046,8091,7903,8051,7671,8140,7930,8
103,8146,8057,8093,8161,7678,7932,8054,8109,8148
,8045,81
10,7919,8152,7675,8115,8094,8053,8135,8162,7871,
8060,7999,8118,8139,8164,8121,7931,8058,8149,803
1,7167,8
107,8142,7927,8168,8124,8047,8117,8147,7933,8141
,8176,8122,8061,8154,7663,8163,8150,8095,8055,81
65,8153,
7934,8170,8119,8156,8111,8059,8169,8166,8125,806
2,8177,8143,8172,7677,8155,8126,8178,8123,8167,8
157,818
0,8151,8174,8158,8184,7679,8171,8173,8179,8181,7
935,8182,8185,8063,8186,8183,8188,8187,8175,8127
,8190,81 91,8159,8189]

**Sequence group 7: Z7_8192**

[0,1,2,7,3,8,11,24,4,10,13,28,16,33,35,77,5,1
2,14,32,19,38,47,81,22,46,42,88,57,96,102,168,6,17,2
1,40,
23,45,51,90,29,55,59,97,72,110,116,186,34,61,75,114
,80,123,135,197,87,137,148,225,153,238,264,385,9,1
8,26,54,
30,58,71,105,36,76,62,117,84,127,142,206,44,74,86,1
36,92,145,152,233,100,155,170,252,184,272,291,432,
53,89,9
8,151,111,162,178,269,121,179,196,283,210,305,321,
473,139,204,230,311,236,324,349,510,257,357,379,5
35,400,5
64,607,863,15,25,31,73,39,79,82,141,48,85,93,150,10
1,160,165,266,56,94,103,163,115,177,193,286,126,19
4,205,3
00,232,318,344,493,64,108,122,183,128,195,213,313,
149,228,237,326,256,355,373,534,164,246,270,361,2
84,393,4
02,559,307,420,458,594,483,628,706,869,69,124,144,
216,159,235,255,359,169,258,275,384,292,401,431,5
83,191,2
87,301,413,325,446,477,642,338,486,515,674,543,71
6,750,1007,212,314,332,462,362,492,519,695,397,53
1,560,74
0,596,754,830,1096,429,574,608,793,623,849,885,11
61,701,905,943,1152,979,1229,1319,1690,20,37,41,9
1,49,95,1
06,176,50,107,118,187,132,207,217,340,63,119,133,2
22,146,231,244,341,154,243,265,378,288,396,408,55
8,67,143 ,156,224,173,247,271,394,181,279,293,410,
304,443,466,620,180,302,316,442,337,480,495,675,3
66,521,544,715,57
2,748,798,1069,78,167,174,277,190,298,315,433,198,
320,330,475,350,508,525,713,259,345,363,513,386,5
41,569,7
42,423,578,614,786,645,846,892,1142,297,381,411,5
51,439,593,618,832,471,634,658,862,707,920,954,12
03,516,7
03,717,944,743,981,926,1249,813,1057,1097,1338,11
09,1459,1527,1769,83,188,192,336,248,354,372,520,
278,377,
387,548,422,580,613,834,294,414,438,581,460,619,6
49,872,487,663,694,910,741,951,1003,1265,339,444,
465,648,
494,685,725,930,546,728,752,999,814,971,1079,1356
,591,778,840,1061,873,1108,1147,1414,921,1155,115
4,1507,
1251,1551,1611,1944,380,484,522,729,579,753,797,1

019,615,833,851,1098,902,1117,1153,1453,652,881,9
36,1143 ,958,1159,1257,1553,1015,1278,1315,1621,1
382,1713,1766,2133,714,948,993,1259,1077,1268,13
70,1648,1094,13
62,1424,1733,1486,1805,1910,2294,1119,1472,1541,
1837,1590,1924,1874,2335,1685,2001,2048,2498,216
8,2568,2
703,3011,27,43,52,99,60,120,134,214,66,138,147,221
,158,241,245,390,68,157,166,240,175,299,308,428,20
0,310,3
35,472,352,497,523,738,70,172,189,303,202,333,346,
490,215,358,374,532,392,565,588,756,229,382,405,5
76,434,6
12,629,820,448,621,665,880,672,908,949,1333,109,2
01,211,351,223,375,391,550,253,409,424,600,451,64
0,662,83
8,276,427,464,626,489,670,681,894,512,683,692,953,
776,982,1051,1358,295,488,506,690,540,719,737,963
,568,77
5,803,1014,854,1070,1099,1429,599,829,876,1105,92
2,1138,1213,1489,989,1220,1282,1568,1316,1631,17
22,2122,
112,219,242,403,274,425,459,644,290,467,491,684,5
17,697,709,960,319,507,537,711,567,766,795,1010,5
97,818,8
52,1090,895,1120,1187,1434,347,549,587,799,630,84
1,839,1123,653,884,906,1162,965,1217,1237,1573,69
6,923,9
85,1230,1011,1297,1318,1656,1056,1350,1403,1734,
1503,1815,1917,2307,368,606,635,886,680,919,967,1
221,763,
988,1034,1311,1038,1328,1377,1709,779,1036,1055,
1367,1135,1402,1478,1802,1200,1500,1539,1840,160
5,1954,2
018,2362,819,1149,1176,1437,1242,1511,1550,1895,
1283,1595,1659,1988,1723,2056,2147,2521,1409,166
5,1741,2
073,1834,2186,2227,2665,1897,2273,2333,2743,2429
,2868,2981,3454,129,254,282,470,317,505,533,747,3
28,542,5
75,773,601,810,871,1189,360,589,643,835,667,917,8
97,1202,686,937,978,1277,1030,1303,1336,1686,435,
656,687,
911,762,962,994,1314,772,1033,1049,1337,1076,137
8,1413,1779,780,1066,1112,1411,1198,1475,1531,18
43,1232,
1583,1604,1961,1664,2019,2101,2477,450,761,765,1
012,785,1037,1089,1392,828,1136,1173,1455,1218,1
518,1592 ,1929,984,1191,1248,1533,1287,1628,1667,
2003,1383,1680,1752,2079,1836,2178,2207,2655,104
8,1296,1366,1630 ,1410,1730,1786,2119,1484,1811,1
858,2204,1925,2275,2360,2793,1548,1902,1980,2332
,2043,2404,2476,2882,213
0,2501,2557,2970,2622,3099,3124,3759,463,787,809,
1185,961,1207,1236,1581,1001,1269,1307,1639,1374
,1701,1
777,2109,1053,1334,1405,1717,1451,1789,1861,2197
,1526,1922,1849,2259,2006,2343,2428,2819,1201,14
15,1474,
1823,1571,1878,1963,2322,1617,1981,2042,2405,209
7,2433,2533,2947,1726,2067,2142,2485,2235,2588,2
645,305
9,2290,2732,2778,3190,2869,3268,3298,3622,1292,1
479,1614,1986,1691,2036,2070,2460,1767,2163,2190
,2550,22
61,2589,2747,3118,1783,2243,2324,2724,2426,2798,
2803,3294,2509,2896,2943,3339,3038,3476,3551,394
9,1932,2
398,2406,2850,2546,2900,2972,3369,2618,3058,3080
,3520,3209,3556,3775,4114,2689,3175,3243,3662,33
52,3689,
3860,4249,3427,3894,3944,4370,4048,4478,4543,494
4,140,113,65,289,104,267,182,518,125,185,203,456,2
20,356,
327,592,161,218,239,334,268,412,376,691,306,388,4
30,561,474,767,632,957,171,249,273,395,309,421,48
1,609,32
9,509,447,868,547,657,702,1329,353,485,577,671,53
0,736,825,1127,602,808,764,998,893,1190,1039,1658
,199,296 ,312,461,348,496,557,710,383,625,511,751,
590,781,848,1054,415,545,669,821,633,952,802,1095
,582,853,980,114
8,916,1386,1228,2000,449,666,603,903,755,870,1008
,1175,700,1067,942,1300,995,1241,1582,1458,792,10
18,1081 ,1425,1126,1312,1357,1712,1177,1501,1395,
1903,1569,2234,1803,2646,234,331,369,536,404,573,
624,831,445,712 ,595,860,659,900,964,1258,476,631,
757,909,693,1050,945,1233,784,1000,1113,1317,107
1,1372,1481,1748,514,74
6,673,970,850,1031,1121,1347,824,1197,1052,1594,1
163,1422,1435,1850,904,1110,1276,1480,1219,1517,
1640,22
84,1339,1684,1576,1893,1776,2021,2100,2768,566,7
74,877,1091,812,1134,1239,1499,927,1304,1172,172
9,1359,1
538,1635,1960,983,1212,1373,1588,1454,1668,1842,
2039,1279,1797,1700,2196,1900,2132,2334,2936,103
5,1408,1
487,1807,1310,1735,1871,2397,1549,1950,2033,2206
,1768,2499,2295,3628,1610,1989,2078,2461,2135,23
53,2432,
3095,1916,2554,2623,2849,2702,3389,2980,4423,285
,389,426,627,482,718,664,956,504,682,842,1006,760,
1064,11
16,1394,556,794,739,1088,847,1231,1042,1452,918,1
137,1256,1510,1184,1708,1629,2265,598,861,811,13
32,992,1
122,1188,1519,901,1216,1293,1828,1363,1579,1669,
2049,1013,1393,1313,1728,1488,1643,1835,2129,143
3,1796,1
886,2183,1959,2302,2479,2832,641,1078,887,1243,9
50,1412,1302,1740,1043,1346,1461,1687,1516,1806,
1896,223
6,1146,1589,1436,2029,1379,1830,1879,2435,1681,1
947,2057,2312,2131,2391,2559,3163,1206,1620,1514
,1911,17 19,2002,2187,2539,1814,2258,2035,2456,2096,2735,
2640,3067,1552,2162,2352,2675,2274,2594,2918,305
2,2407,2
862,2769,3332,3019,3227,3477,4522,724,966,1104,1
387,1174,1450,1638,1928,1240,1754,1485,1987,1577
,1860,21
34,2535,1060,1532,1615,2094,1732,2303,2032,2493,
1859,2201,2264,2710,1946,2883,2630,3774,1335,165
7,1804,2
382,1931,2226,2179,2828,1718,2288,2469,2664,2401
,2758,2961,3261,2071,2437,2342,2779,2538,3107,29
03,3347,
2641,2982,3182,3519,3081,3450,3861,4113,1404,183
1,1971,2285,1755,2551,2361,2848,2123,2390,2695,2
944,246
8,3018,3204,3602,1894,2595,2511,3037,2725,3242,3
093,3574,2874,3130,3406,3505,3323,3935,3806,4274
,2203,27
99,2652,3223,2951,3642,3156,3739,2555,3424,3299,
3830,3338,3913,4045,5157,2773,3611,3521,4148,346
1,4016,4
212,4624,3717,4163,4097,4761,4347,5509,4656,5805
,367,457,524,749,586,777,843,1118,622,955,815,126
4,896,11
60,1324,1634,668,855,1009,1196,931,1441,1250,170
7,1065,1376,1515,2020,1351,1749,1822,2314,708,10
02,959,1
306,1080,1371,1498,1848,1199,1591,1423,1782,1572
,1901,2111,2453,1139,1530,1473,1892,1642,2050,19
62,2399,
1731,2095,2200,2973,2240,2654,2558,3222,796,1032
,1186,1440,1305,1502,1800,1945,1111,1540,1666,20
28,1578,
2169,2037,2520,1286,1716,1753,2299,1616,2110,226
0,2694,1923,2325,2149,2615,2434,2772,2901,3441,1
432,178
8,1970,2205,1870,2383,2313,2823,2066,2548,2457,2
759,2298,2919,2995,3402,1841,2579,2508,2945,2711
,3131,30
60,3575,2417,3039,3210,3923,3322,3799,3688,4457,
907,1325,1158,1641,1238,1958,1593,2241,1460,1706
,1851,22
15,1810,2146,2374,2833,1428,2072,1887,2478,1787,
2323,2291,2929,2034,2427,2619,2775,2547,3026,309
8,3537,1
570,1933,2128,2396,2191,2674,2532,3174,1951,2492
,2802,3066,2614,2983,3295,3643,2242,2762,2669,31
11,2937,
3426,3216,3753,2897,3316,3562,3826,3460,3948,402
0,4829,1727,2272,2038,2647,2143,2556,2792,3236,2
315,301
0,2742,3191,2851,3337,3407,3868,2416,2946,2829,3
451,3110,3368,3603,4272,3044,3701,3478,3934,3652
,4096,41
79,4612,2510,2839,3157,3536,2994,3594,3738,4049,
3309,3912,3636,4162,3827,4221,4359,4757,3226,375
8,3920,4
523,4044,4308,4422,5007,3678,4471,4626,4918,4657
,5103,5302,5968,1068,1375,1301,1875,1506,1955,18
29,2363,
1580,1778,2148,2688,2051,2436,2569,3045,1649,210
8,2007,2484,2289,2902,2549,3125,2237,2631,2763,3
336,283
8,3211,3479,3922,1801,2306,2202,2653,2400,2734,2
774,3237,2118,2822,2960,3504,3092,3437,3388,4005
,2500,29
71,3162,3353,3053,3563,3653,4122,2928,3724,3550,
4051,3810,4235,4346,4861,1930,2182,2534,2950,237
5,2875,3
119,3517,2668,3269,3027,3440,2644,3610,3679,4155
,2746,3094,3183,3927,3308,3637,3782,4542,3425,39
08,3725,
4220,4019,4309,4516,4941,2863,3208,3518,3783,333
3,4058,3909,4371,3623,3831,4123,4449,3945,4727,4
566,505
0,3455,4050,4213,4613,4316,4798,4718,5225,4178,4
645,4919,5345,4860,5149,5439,6037,2214,2452,2578
,3106,28
18,3403,3061,3716,2733,3217,3205,3869,3346,4004,
3811,4479,2942,3557,3317,3798,3629,3921,4149,444
8,3516,4
059,4195,4567,4021,4648,4771,5224,3036,3436,3752
,4017,3595,4234,4112,4627,3663,4154,4275,4945,44
70,4719,
4756,5344,3895,4403,4533,4770,4358,5051,4862,533
2,4248,4889,5148,5587,5021,5438,5565,6373,3260,3
700,380
7,4402,4018,4194,4532,4799,3926,4273,4456,4863,4
625,5120,5006,5441,4115,4517,4644,5102,4726,4940
,5207,56
79,4760,5235,5156,5564,5333,5663,5769,6800,4317,
4649,4828,5206,4888,5234,5409,5662,5020,5408,530
3,5872,5
508,5873,5768,6372,5121,5440,5586,5882,5678,5883
,5969,6179,5804,6036,6178,6285,6284,6801,6446,64
47,130,1
31,208,251,209,280,323,440,226,322,343,478,370,52
7,529,783,227,342,364,526,399,562,611,817,436,610,
584,844,
661,888,924,1208,250,371,407,570,437,605,647,874,
479,655,689,889,768,946,986,1280,528,699,771,976,
816,1005 ,1063,1299,837,1073,1124,1421,1141,1456,
1528,1909,281,398,468,654,498,688,759,929,538,782
,704,987,826,102
9,1092,1348,604,770,836,1072,878,1107,1140,1439,8
98,1145,1210,1504,1270,1554,1613,2022,651,845,89
0,1133,9
47,1166,1226,1537,997,1227,1298,1597,1360,1651,1
711,2117,1075,1344,1430,1689,1448,1714,1795,2198
,1513,18
21,1889,2281,1948,2368,2455,2993,365,441,499,769,
563,801,822,1083,616,827,879,1132,899,1164,1179,1
534,660 ,882,925,1167,977,1225,1291,1606,1028,129
4,1345,1632,1438,1704,1790,2177,726,940,1004,126
7,1040,1295,136
5,1697,1125,1426,1449,1720,1512,1813,1873,2280,1

178,1490,1542,1839,1598,1935,1952,2341,1671,1984,2076,24
24,2151,2502,2666,3005,745,1016,1106,1380,1157,1443,1509,1833,1209,1524,1561,1908,1618,1949,2017,2395,12
89,1607,1633,1979,1715,2058,2141,2526,1780,2164,2225,2600,2293,2690,2744,3239,1364,1698,1750,2086,1856,2
176,2239,2635,1943,2277,2354,2720,2430,2760,2922,3396,2011,2378,2458,2827,2491,2953,3029,3509,2657,3063,
3127,3500,3193,3631,3773,4302,406,539,571,875,617,883,938,1224,646,939,990,1281,1058,1349,1381,1784,705,9
91,1059,1406,1114,1431,1482,1785,1144,1477,1529,1888,1608,1942,1968,2340,731,1093,1150,1420,1215,1491,15
43,1940,1235,1575,1619,1976,1650,2053,2098,2488,1234,1636,1702,2052,1771,2144,2181,2601,1862,2257,2296,2
687,2376,2740,2836,3351,800,1205,1222,1563,1288,1626,1699,2023,1308,1710,1742,2121,1798,2194,2267,2685,1
525,1791,1857,2213,1918,2287,2373,2722,1991,2388,2470,2824,2537,2948,3046,3490,1625,1891,1977,2321,2041,
2419,2486,2924,2103,2522,2566,2992,2667,3086,3154,3593,2232,2659,2691,3128,2723,3195,3104,3655,2881,332
1,3397,3796,3405,3981,4067,4401,823,1284,1290,1770,1496,1812,1872,2256,1574,1885,1919,2304,1990,2392,246
3,2926,1622,1982,2040,2393,2084,2487,2545,3008,2165,2571,2634,3074,2721,3147,3231,3677,1781,2054,2093,25
44,2180,2617,2701,3108,2300,2708,2756,3225,2898,3189,3373,3816,2411,2814,2938,3335,3009,3404,3497,3902,3
087,3503,3502,4047,3661,4105,4197,4636,1890,2160,2262,2709,2389,2757,2835,3271,2471,2925,2955,3398,3056,
3439,3501,3965,2552,3025,3116,3491,3160,3507,3665,4107,3263,3708,3765,4207,3870,4327,4390,4849,2686,314
4,3219,3667,3371,3690,3848,4232,3390,3824,3914,4355,4008,4463,4604,5048,3443,3988,4091,4499,4164,4610,45
40,5089,4287,4705,4762,5284,4890,5346,5477,5771,469,585,650,891,698,996,1062,1368,730,1074,1115,1401,115
6,1463,1483,1926,744,1151,1204,1462,1223,1627,1682,2010,1326,1688,1765,2116,1808,2185,2263,2718,758,1214 ,1285,1637,1330,1751,1792,2170,1369,1832,1876,2278,1934,2369,2408,2770,1427,1898,1957,2380,2030,2462,250
3,2910,2064,2489,2577,3024,2592,3072,3145,3787,941,1327,1361,1799,1407,1877,1927,2320,1505,1969,2004,244
4,2069,2524,2570,2930,1562,2009,2092,2496,2167,2590,2603,3048,2212,2613,2632,3153,2812,3196,3307,3818,16
23,2166,2192,2628,2286,2693,2717,3167,2372,2811,2861,3262,2968,3354,3399,3925,2439,2921,3016,3401,3096,3
488,3609,4011,3207,3620,3710,4116,3766,4217,4344,4830,968,1385,1476,1953,1560,2005,2077,2536,1612,2099,2
171,2616,2233,2643,2671,3164,1705,2193,2283,2673,2371,2800,2831,3252,2431,2908,2962,3382,3049,3448,3549,
3936,1793,2305,2403,2837,2516,2939,2931,3453,2553,3028,3064,3510,3173,3613,3639,4121,2642,3097,3199,363
2,3253,3737,3772,4236,3320,3808,3887,4356,4035,4485,4607,5057,1868,2454,2523,3030,2602,3085,3181,3621,27
95,3206,3288,3755,3292,3784,3859,4325,2815,3290,3319,3829,3481,3886,4000,4460,3590,4032,4089,4504,4193,4
650,4720,5114,2909,3499,3526,3939,3646,4057,4104,4585,3711,4177,4239,4698,4345,4772,4867,5301,3897,4251,
4369,4783,4496,4908,4947,5443,4587,5013,5079,5495,5195,5618,5743,6146,1041,1508,1596,2102,1703,2189,227
9,2727,1724,2292,2379,2809,2445,2872,3007,3559,1838,2409,2527,2927,2585,3083,3051,3592,2620,3117,3192,37
03,3276,3747,3794,4300,2031,2564,2621,3075,2794,3166,3220,3764,2808,3279,3305,3795,3370,3862,3901,4415,2
816,3348,3414,3899,3588,3991,4081,4507,3634,4153,4192,4661,4250,4721,4813,5257,2068,2777,2797,3254,2821,
3291,3381,3878,2920,3482,3523,3967,3614,4064,4166,4615,3198,3561,3654,4083,3719,4214,4261,4707,3871,428
4,4378,4797,4498,4904,4935,5437,3304,3736,3828,4216,3898,4352,4428,4827,4006,4477,4518,4932,4611,5015,51
12,5553,4098,4594,4678,5078,4759,5178,5256,5630,4834,5287,5337,5726,5402,5855,5880,6419,2087,2825,2871,3
539,3165,3601,3638,4151,3229,3691,3751,4223,3856,4311,4413,4815,3311,3792,3893,4337,3951,4431,4521,4917,
4066,4608,4509,4989,4716,5091,5194,5581,3591,3903,3990,4487,4119,4564,4663,5070,4205,4679,4758,5179,480
7,5201,5305,5717,4348,4775,4864,5277,4957,5350,5411,5835,5042,5486,5542,5942,5619,6016,6032,6286,3726,40
01,4198,4696,4303,4744,4780,5226,4391,4879,4910,5326,4991,5351,5511,5874,4421,4979,5076,5484,5192,5554,5
567,6018,5297,5648,5709,6067,5824,6166,6219,6545,4622,5170,5188,5610,5314,5650,5740,6085,5400,58 34,5844,
6198,5947,6224,6429,6646,5461,5939,5981,6336,607 8,6345,6496,6747,6111,6512,6538,6838,6624,6918,6 939,717
0,1082,969,727,1609,928,1535,1266,2238,1017,1271, 1331,2074,1400,1820,1721,2418,1165,1384,1457,176 4,1536,
1978,1884,2629,1670,1920,2016,2355,2120,2801,251 8,3159,1211,1497,1555,1941,1683,1985,2145,2459,1 725,219
5,2059,3004,2301,2565,2658,3785,1809,2161,2381,2 591,2276,2716,2917,3463,2446,2870,2796,3224,3047 ,3560,32
93,4238,1309,1624,1696,2085,1794,2184,2327,2672, 1899,2495,2199,2745,2410,2817,2952,3318,1983,229 7,2587,2
911,2519,3152,2860,3391,2394,2963,3194,3498,3082 ,3876,3630,4704,2065,2584,2447,3057,2761,3006,32 40,3525,
2656,3349,3126,3744,3221,3645,4152,3980,2826,327 0,3375,3915,3462,3756,3817,4326,3527,4033,3885,4 595,411
7,4956,4461,5424,1442,1743,1869,2282,1956,2377,2 494,2923,2055,2684,2425,2974,2567,3054,3172,3666 ,2140,25
17,2771,3073,2633,3306,3129,3635,2820,3228,3415, 3767,3355,3850,4003,4376,2224,2726,2593,3188,295 4,3277,3
449,3805,2916,3573,3310,4176,3511,3910,3937,4510 ,3062,3412,3702,4002,3615,4063,4228,5022,3797,42 86,4136,
4575,4412,4723,4812,5528,2370,2810,3017,3383,288 0,3480,3641,4023,3105,3748,3522,4351,3819,4088,4 219,466
0,3197,3608,3851,4160,3966,4262,4506,4747,3709,4 451,4310,4916,4592,4848,5088,5686,3289,3896,4009 ,4469,37
54,4357,4535,5169,4099,4646,4733,4934,4400,5285, 5049,6308,4196,4699,4796,5227,4851,5101,5200,585 3,4606,5
334,5403,5609,5476,6087,5742,6851,1599,1921,2008 ,2497,2150,2692,2576,3158,2188,2612,2940,3238,27 76,3344,
3438,3884,2326,2830,2719,3380,2949,3633,3296,396 4,3084,3483,3664,4056,3538,4324,4215,5005,2438,2 975,287
3,3786,3218,3452,3558,4065,3055,3612,3727,4492,3 825,4139,4263,4763,3255,3879,3757,4350,4010,4231 ,4497,48
33,3933,4450,4572,4907,4659,5054,5259,5592,2525, 3372,3031,3647,3146,3900,3746,4368,3297,3804,398 3,4301,4
062,4468,4586,4958,3496,4161,3938,4725,3863,4494 ,4565,5203,4285,4639,4773,5058,4835,5159,5339,59 37,3600,
4206,4060,4605,4339,4706,4909,5313,4484,4988,473 5,5214,4806,5493,5406,5843,4106,4878,5100,5455,5 014,538
4,5676,5832,5189,5616,5529,6054,5777,5973,6167,6 930,2700,3180,3400,3877,3524,3950,4222,4614,3644 ,4388,40
07,4697,4137,4520,4850,5307,3334,4082,4199,4804, 4354,5055,4732,5279,4519,4925,5004,5478,4638,563 1,5404,6
428,3793,4237,4462,5150,4621,4946,4905,5584,4338 ,5040,5233,5442,5177,5512,5725,5983,4781,5205,50 90,5543,
5312,5861,5661,6077,5407,5748,5940,6197,5845,614 4,6497,6645,3892,4495,4677,5023,4389,5327,5113,5 608,483
1,5158,5463,5710,5232,5776,5944,6276,4584,5385,5 299,5807,5485,5980,5847,6252,5628,5920,6102,6193 ,6053,65
37,6434,6774,4927,5555,5426,5971,5719,6324,5922, 6375,5335,6108,6033,6454,6066,6517,6607,7325,553 1,6279,6
199,6670,6165,6588,6724,6996,6365,6699,6635,7089 ,6803,7469,7020,7637,1863,2075,2266,2741,2402,28 13,2941,
3442,2490,3155,2899,3676,3050,3508,3780,4218,258 6,2969,3241,3572,3109,3947,3660,4319,3345,3858,4 061,472
2,3809,4377,4486,5068,2670,3230,3161,3750,3374,3 849,4022,4508,3589,4165,3911,4420,4120,4593,4825 ,5213,34
89,4080,3989,4574,4230,4768,4662,5171,4353,4805, 4924,5741,4976,5436,5338,5970,2834,3278,3548,394 6,3749,4
034,4458,4637,3413,4090,4260,4724,4138,4891,4745 ,5300,3718,4336,4379,5053,4204,4824,4990,5462,46 09,5077,
4877,5387,5202,5530,5651,6131,3932,4430,4676,493 3,4534,5151,5059,5583,4774,5324,5215,5513,5052,5 677,575
1,6100,4505,5349,5296,5711,5479,5921,5840,6253,5 191,5825,5960,6529,6052,6433,6344,6871,3065,3781 ,3506,42
29,3640,4658,4167,4977,3982,4318,4511,4943,4476, 4866,5122,5593,3924,4782,4573,5258,4429,5071,504 3,5685,4
734,5193,5401,5541,5315,5778,5854,6217,4118,4623 ,4832,5168,4911,5454,5304,5938,4647,5278,5566,58 42,5386,
5749,6019,6325,4978,5514,5453,5863,5687,6110,596 2,6417,5649,6038,6226,6452,6164,6544,6604,7107,4 349,501
2,4746,5425,4865,5336,5552,5974,5069,5770,5494,5 943,5611,6065,6103,6498,5190,5716,5585,6145,5862 ,6084,62
77,6772,5826,6347,6176,6536,6326,6634,6721,6946, 5298,5595,5923,6216,5750,6254,6374,6625,6035,651 6,6310,6
698,6453,6727,6837,7063,5972,6418,6518,6931,6606 ,6792,6850,7217,6338,6917,6998,7166,7021,7259,73 84,7690,

3350,3857,3745,4541,4046,4651,4493,5115,4150,4414,4876,5460,4769,5204,5347,5827,4233,4814,4717,5276,504
1,5660,5325,5881,4959,5405,5515,6064,5594,5961,6177,6528,4459,5056,4926,5427,5176,5492,5540,5975,4826,55
82,5724,6192,5846,6129,6086,6547,5286,5727,5936,6079,5833,6227,6327,6668,5684,6366,6218,6627,6444,6745,6
802,7145,4620,4906,5306,5718,5123,5629,5875,6195,5452,6017,5779,6130,5410,6278,6339,6697,5510,5852,5941,
6531,6034,6311,6430,6938,6109,6514,6367,6726,6591,6793,6928,7169,5617,5946,6196,6431,6055,6632,6515,683
9,6287,6455,6669,6869,6539,7061,6944,7256,6147,6626,6725,6947,6794,7104,7022,7333,6720,7009,7167,7401,71
44,7279,7457,7737,4942,5212,5348,5860,5580,6101,5841,6364,5487,5963,5945,6499,6076,6546,6445,6919,5708,6
225,6039,6432,6309,6519,6671,6868,6194,6633,6723,6945,6605,7010,7091,7332,5806,6128,6416,6589,6255,6744,
6644,6999,6337,6696,6775,7171,6916,7023,7062,7400,6513,6849,6937,7090,6836,7257,7146,7386,6746,7165,727
8,7513,7219,7456,7471,7775,5982,6346,6435,6848,6590,6722,6936,7105,6530,6773,6870,7147,6997,7276,7216,74
59,6647,6929,7008,7258,7060,7168,7327,7553,7088,7335,7324,7470,7387,7515,7555,7930,6795,7011,7106,7326,7
164,7334,7403,7514,7218,7402,7385,7638,7468,7639,7554,7774,7277,7458,7512,7688,7552,7689,7691,7739,7636,
7736,7738,7773,7772,7931,7928,7929,260,261,262,419,263,452,455,676,416,454,501,720,552,733,735,1085,417,5
00,502,732,555,790,859,1101,638,858,806,1168,933,1192,1246,1564,418,553,637,804,639,857,867,1170,721,915,9
35,1193,1044,1262,1320,1654,734,973,1047,1274,1100,1343,1399,1677,1131,1417,1468,1817,1493,1854,1964,234
9,453,554,678,914,722,934,1027,1253,788,1084,974,1321,1128,1355,1446,1738,856,1046,1130,1416,1180,1465,14
92,1845,1244,1495,1566,1912,1652,1992,2047,2504,913,1169,1194,1471,1263,1546,1602,1973,1341,1603,1676,20
15,1746,2105,2153,2609,1419,1736,1826,2115,1852,2156,2245,2706,1937,2253,2339,2767,2412,2852,2959,3515,5
03,677,723,1045,791,1087,1102,1445,864,1129,1181,1470,1245,1544,1557,1966,932,1182,1247,1547,1275,1601,1
673,2026,1354,1674,1737,2088,1844,2138,2228,2677,1020,1260,1342,1647,1388,1675,1757,2125,1469,1824,1853,
2158,1936,2251,2329,2766,1556,1882,1974,2269,2024,2365,2414,2843,2107,2464,2574,2906,2639,3000,3186,352
9,1025,1352,1464,1760,1523,1847,1915,2255,1565,1938,1995,2348,2060,2413,2483,2887,1663,2027,2089,2449,21
57,2542,2625,3022,2218,2650,2715,3122,2787,3232,3282,3791,1756,2126,2208,2582,2270,2676,2731,3151,2385,2
755,2844,3264,2912,3286,3446,3960,2481,2866,2964,3377,2991,3485,3553,4073,3177,3585,3671,4052,3723,4181,
4315,4846,636,789,805,1171,865,1183,1254,1600,866,1255,1322,1655,1396,1739,1761,2220,975,1323,1397,1774,
1466,1827,1880,2221,1494,1867,1965,2338,2044,2384,2440,2842,1023,1447,1520,1816,1585,1883,1975,2366,164
5,1999,2061,2442,2104,2531,2598,2988,1644,2090,2136,2530,2217,2636,2679,3123,2310,2737,2788,3215,2864,32
80,3386,3905,1086,1559,1586,1997,1662,2082,2127,2505,1678,2152,2174,2611,2246,2704,2749,3213,1939,2229,2
271,2713,2350,2785,2857,3266,2467,2878,2978,3366,3033,3474,3568,4030,2081,2345,2443,2807,2515,2905,2986,
3456,2607,3014,3078,3514,3187,3616,3686,4131,2728,3179,3233,3672,3267,3729,3626,4209,3417,3873,3961,434
2,3973,4531,4619,4953,1103,1660,1672,2216,1904,2250,2328,2736,1998,2337,2351,2804,2466,2884,2977,3458,20
62,2450,2514,2885,2580,2987,3041,3532,2651,3091,3150,3598,3265,3683,3779,4241,2219,2540,2597,3040,2678,3
137,3245,3650,2790,3248,3284,3771,3418,3715,3931,4372,2895,3358,3468,3881,3533,3972,4039,4446,3617,4055,
4054,4583,4211,4667,4739,5160,2344,2648,2738,3249,2879,3285,3385,3823,2979,3457,3487,3962,3582,3985,405
3,4525,3068,3545,3656,4031,3694,4071,4225,4669,3815,4254,4307,4753,4410,4881,4950,5381,3214,3680,3761,42
27,3929,4244,4394,4800,3958,4382,4464,4913,4558,4997,5126,5562,3987,4544,4653,5033,4702,5136,5082,5607,4
841,5237,5280,5766,5420,5836,5967,6235,679,807,912,1195,972,1340,1398,1758,1022,1418,1467,1773,1522,1865 ,1881,2358,1024,1521,1558,1864,1587,2083,2112,2480,1692,2114,2211,2608,2248,2681,2739,3258,1026,1584,166
1,2091,1694,2209,2230,2662,1759,2254,2330,2764,2364,2853,2892,3300,1825,2346,2421,2876,2506,2976,3001,34 28,2560,2989,3101,3544,3120,3596,3681,4333,1261,
1693,1747,2247,1775,2331,2359,2806,1913,2441,247
2,2932,2
563,3020,3090,3466,1996,2475,2596,2998,2661,3114
,3133,3570,2712,3135,3148,3685,3356,3730,3855,43
74,2063,
2660,2698,3142,2784,3235,3257,3699,2856,3343,339
5,3814,3494,3906,3963,4473,2915,3445,3540,3969,3
618,402
6,4145,4561,3741,4168,4258,4680,4312,4779,4894,5
374,1272,1763,1866,2415,1994,2473,2575,3032,2046
,2599,26
63,3136,2729,3169,3201,3696,2139,2699,2781,3203,
2855,3326,3379,3802,2913,3422,3492,3954,3571,399
2,4103,4
482.2231.2805.2891.3387.3002.3469.3467.3995.3069
.3552.3586.4074.3705.4157.4189.4685.3168.3619.37
33.4182,
3803,4281,4314,4808,3872,4366,4435,4914,4579,501
1,5129,5579,2316,2958,3015,3554,3132,3607,3707,4
169,331
5,3740,3838,4299,3842,4328,4405,4873,3359,3840,3
867,4387,4015,4434,4550,4994,4128,4576,4643,5036
,4729,51
74,5250,5626,3423,4041,4092,4489,4202,4591,4666,
5107,4259,4711,4811,5228,4895,5292,5395,5789,444
1,4817,4
921,5321,5030,5446,5491,5925,5109,5533,5605,6003
,5697,6116,6213,6582,1389,1914,2014,2606,2137,26
97,2765,
3275,2172,2786,2867,3341,2933,3410,3531,4109,226
8,2893,3023,3459,3103,3605,3577,4130,3138,3657,3
722,425
3,3834,4291,4340,4842,2507,3076,3139,3599,3314,3
698,3762,4306,3340,3837,3853,4341,3928,4406,4445
,4963,33
60,3890,3976,4443,4126,4547,4631,5039,4184,4695,
4728,5185,4816,5251,5361,5745,2562,3313,3325,381
2,3365,3
841,3953,4424,3444,4024,4085,4527,4158,4602,4708
,5141,3732,4111,4208,4633,4267,4776,4819,5239,44
11,4836,
4936,5331,5032,5430,5475,5915,3852,4280,4386,477
8,4442,4902,4970,5371,4556,5003,5062,5472,5137,5
535,562
4,6041,4664,5118,5216,5604,5275,5672,5744,6126,5
378,5773,5821,6206,5894,6307,6328,6791,2583,3367
,3409,41
01,3697,4135,4188,4693,3777,4245,4295,4791,4398,
4857,4961,5365,3865,4334,4437,4885,4515,4973,506
5,5465,4
618,5134,5045,5519,5242,5615,5696,6071,4129,4447
,4546,5019,4683,5086,5187,5598,4749,5217,5274,56
73,5357,
5701,5797,6183,4898,5311,5390,5753,5499,5864,590
9,6271,5558,5996,6030,6382,6117,6448,6470,6694,4
276,455
1,4742,5222,4847,5268,5318,5732,4951,5415,5450,5
814,5521,5865,6007,6322,4967,5507,5600,5992,5694
,6046,60
51,6466,5781,6132,6175,6495,6250,6592,6655,6925,
5144,5666,5674,6106,5810,6136,6208,6521,5890,627
0,6292,6
636,6397,6656,6807,7026,5953,6371,6427,6734,6508
,6749,6860,7109,6567,6882,6920,7174,6980,7222,72
63,7464,
1444,1273,1021,2045,1252,1967,1646,2730,1353,165
3,1695,2572,1772,2252,2159,2904,1545,1762,1855,2
210,197
2,2448,2336,3143,2106,2356,2482,2845,2610,3327,3
012,3693,1567,1905,1993,2367,2113,2465,2637,2965
,2173,27
05,2543,3528,2791,3077,3178,4329,2249,2649,2877,
3115,2754,3256,3433,3999,2934,3408,3324,3770,356
9,4110,3
843,4810,1679,2080,2124,2581,2244,2680,2841,3202
,2347,2997,2707,3283,2894,3361,3484,3866,2451,27
89,3113,
3429,3013,3684,3394,3959,2886,3493,3728,4040,360
4,4418,4180,5236,2561,3102,2935,3583,3287,3530,3
800,408
7,3176,3891,3670,4288,3763,4201,4694,4530,3376,3
822,3941,4465,3998,4304,4373,4880,4093,4577,4427
,5119,46
81,5498,4995,5910,1846,2175,2317,2780,2420,2865,
2996,3447,2541,3212,2907,3512,3079,3580,3704,422
6,2624,3
003,3301,3597,3149,3854,3673,4185,3364,3776,3977
,4313,3907,4396,4553,4928,2714,3274,3121,3714,34
86,3835,
3993,4363,3432,4125,3864,4710,4075,4454,4483,504
6,3584,3974,4252,4552,4159,4601,4792,5548,4343,4
840,468
8,5105,4960,5253,5360,6020,2854,3342,3541,3955,3
416,4014,4191,4571,3627,4292,4084,4901,4375,4642
,4787,51
84,3731,4144,4397,4700,4526,4820,5038,5271,4255,
4985,4856,5464,5116,5380,5606,6168,3839,4440,455
9,4999,4
298,4915,5075,5665,4665,5166,5265,5474,4952,5767
,5563,6700,4738,5229,5330,5733,5383,5621,5700,63
03,5128,
5818,5895,6105,5966,6541,6212,7195,2025,2357,247
4,2999,2638,3234,3100,3692,2696,3134,3470,3790,3
312,388
8,3984,4426,2840,3378,3259,3952,3475,4183,3846,4
524,3606,4025,4224,4590,4100,4872,4777,5525,2914
,3513,34
11,4332,3760,3994,4108,4603,3581,4156,4277,5024,
4383,4691,4821,5281,3813,4425,4305,4900,4560,479
5,5031,5
377,4481,4984,5094,5435,5183,5574,5747,6092,3021
,3930,3555,4203,3682,4444,4290,4920,3847,4362,45
37,4843,
4600,4998,5108,5500,4038,4701,4488,5261,4407,502
6,5087,5703,4837,5163,5293,5588,5379,5655,5823,6

359,413
4,4752,4598,5127,4887,5238,5447,5803,5010,5518,5267,5728,5356,5999,5904,6283,4668,5414,5620,5935,5534,58
70,6150,6264,5675,6114,6021,6488,6239,6411,6593,7250,3244,3706,3968,4419,4086,4514,4790,5140,4200,4938,4
557,5223,4689,5064,5382,5799,3880,4632,4743,5354,4912,5575,5264,5761,5063,5469,5524,5978,5162,6127,5898,
6806,4335,4809,4996,5646,5143,5490,5431,6088,4886,5556,5737,5924,5669,6010,6201,6441,5319,5705,5614,603
1,5802,6315,6139,6503,5905,6214,6378,6631,6293,6578,6861,7025,4436,5027,5199,5549,4939,5815,5625,6104,53
75,5654,5959,6180,5736,6238,6392,6682,5106,5871,5783,6249,5993,6426,6301,6666,6122,6334,6558,6617,6487,6
911,6826,7118,5471,6047,5912,6407,6187,6714,6352,6771,5819,6564,6471,6846,6494,6897,6977,7545,6025,6687,
6637,7040,6585,6964,7076,7300,6761,7051,7013,7369,7151,7693,7316,7793,2311,2573,2748,3281,2890,3357,347
1,3986,2990,3687,3419,4240,3576,4072,4320,4786,3112,3495,3801,4124,3651,4501,4210,4871,3889,4404,4599,52
52,4367,4929,5018,5590,3200,3778,3695,4294,3940,4395,4570,5044,4127,4703,4455,4966,4684,5117,5367,5721,4
027,4630,4545,5104,4794,5282,5186,5667,4903,5355,5468,6209,5504,5914,5822,6406,3384,3836,4102,4500,4293,
4578,4992,5161,3975,4652,4818,5260,4690,5421,5269,5788,4266,4884,4937,5571,4748,5366,5520,5958,5135,560
1,5397,5887,5702,6024,6137,6573,4480,4972,5198,5473,5074,5647,5589,6075,5310,5812,5729,6011,5570,6151,62
23,6554,5037,5851,5780,6181,5979,6335,6272,6667,5689,6251,6398,6903,6486,6823,6748,7205,3587,4321,4070,4
793,4190,5182,4709,5505,4536,4870,5047,5483,5002,5394,5638,6093,4472,5320,5095,5746,4971,5599,5559,6161,
5266,5695,5891,6027,5811,6242,6306,6649,4682,5145,5376,5664,5451,5934,5796,6370,5167,5760,6050,6282,588
6,6215,6467,6715,5506,6014,5929,6319,6169,6566,6400,6785,6133,6480,6662,6842,6584,6924,6968,7409,4899,55
32,5270,5911,5391,5820,6040,6420,5591,6234,6002,6383,6107,6493,6559,6864,5688,6182,6089,6579,6318,6520,6
683,7116,6256,6753,6594,6910,6728,7012,7059,7292,5782,6099,6353,6648,6222,6678,6770,6981,6477,6896,6708,
7050,6843,7085,7163,7365,6410,6790,6900,7251,6976,7128,7194,7487,6742,7215,7302,7446,7317,7531,7606,784
8,3904,4399,4289,5083,4582,5175,5025,5627,4692,4962,5396,5952,5283,5704,5837,6257,4801,5364,5243,5752,55
57,6138,5813,6329,5501,5899,6015,6492,6098,6399,6595,6902,4993,5578,5470,5913,5668,5998,6026,6421,5370,6
074,6200,6616,6300,6569,6540,6957,5772,6207,6358,6509,6265,6663,6729,7034,6160,6764,6654,6983,6830,7099,
7150,7421,5142,5434,5798,6186,5639,6123,6323,6629,5928,6449,6243,6572,5908,6686,6743,7047,6006,6302,637
9,6907,6476,6709,6810,7262,6565,6892,6765,7084,6967,7129,7244,7461,6115,6396,6630,6811,6489,6986,6893,71
75,6695,6847,7035,7201,6921,7355,7266,7502,6583,6982,7077,7293,7132,7390,7346,7581,7058,7309,7447,7629,7
420,7541,7663,7869,5482,5720,5850,6314,6070,6555,6273,6760,5997,6401,6393,6865,6502,6956,6831,7223,6174,
6657,6481,6822,6701,6901,7041,7200,6628,6987,7067,7267,6969,7312,7375,7580,6248,6568,6784,6965,6679,709
8,7024,7303,6735,7046,7119,7465,7214,7347,7364,7628,6883,7187,7253,7374,7162,7503,7422,7620,7108,7433,75
40,7723,7493,7662,7713,7965,6440,6752,6827,7186,6966,7066,7252,7391,6906,7117,7204,7423,7301,7536,7486,7
665,7027,7245,7308,7530,7354,7460,7575,7755,7368,7587,7544,7712,7621,7751,7785,8060,7133,7313,7408,7574,
7432,7586,7653,7750,7492,7652,7607,7820,7692,7821,7784,7964,7537,7664,7722,7826,7754,7827,7849,7911,779
2,7868,7910,7941,7940,8061,7982,7983,1390,1391,1744,1907,1745,2012,2155,2528,1818,2154,2223,2626,2318,27
51,2753,3363,1819,2222,2308,2750,2387,2846,2967,3421,2512,2966,2888,3472,3089,3564,3624,4140,1906,2319,2
423,2858,2513,2957,3035,3534,2627,3071,3141,3565,3328,3674,3734,4256,2752,3171,3331,3720,3420,3789,3883,
4283,3465,3917,3996,4453,4029,4528,4628,5125,2013,2386,2604,3070,2682,3140,3303,3649,2782,3362,3184,373
5,3434,3833,3956,4364,2956,3330,3464,3916,3542,3971,4028,4491,3578,4037,4142,4580,4246,4670,4741,5254,30
43,3473,3566,4013,3675,4078,4174,4641,3769,4175,4282,4713,4380,4803,4875,5369,3919,4360,4474,4845,4512,4
882,4983,5466,4597,5017,5097,5545,5164,5632,5723,6221,2309,2529,2683,3329,2847,3393,3430,3943,2984,3435,3543,4012,3579,4076,4095,4634,3088,3546,3625,4079,3721,4173,4271,4730,3832,4278,4361,4784,4490,4868,4974,5429,3246,3668,3788,4243,3844,4279,4385,4853,3997,4466,4513,4892,4596,5009,5081,5544,4094,4562,4654,5035,4714,5147,5172,5613,4823,5220,5328,5692,5399,5774,5926,6229,3273,3820,3970,4408,4069,4503,4589,5029,4141,4616,4673,5124,4750,5165,5249,5659,4269,4731,4785,5211,4883,5294,5389,5794,4964,5416,5489,5876,5561,5954,6004,6423,4384,4854,4930,5342,5060,5428,5503,5903,5155,5537,5622,5988,5698,6012,6154,6548,5247,5642,5730,6083,5759,6189,6245,6621,5917,6275,6331,6612,6385,6703,6805,7126,2422,2783,2859,3535,2985,3547,3658,4172,3034,3659,3742,4257,3874,4365,4409,4968,3185,3743,3875,4438,3978,4475,4554,4969,4036,4549,4629,5096,4736,5154,5196,5612,3251,3957,4042,4452,4147,4563,4655,5152,4187,4687,4751,5208,4802,5289,5358,5756,4186,4788,4858,5288,4955,5392,5433,5877,5066,5517,5568,5951,5640,6000,6096,6507,3392,4133,4170,4675,4268,4766,4855,5255,4296,4874,4922,5373,4986,5458,5527,5949,4617,4975,5061,5481,5130,5551,5637,5990,5231,5652,5738,6080,5801,6184,6258,6602,4765,5099,5209,5597,5273,5691,5754,6156,5363,5790,5830,6220,5927,6298,6350,6677,5496,5919,5955,6332,5991,6387,6312,6731,6125,6485,6549,6820,6557,6941,6995,7185,3431,4264,4270,4954,4568,5008,5080,5516,4686,5093,5131,5576,5230,5656,5735,6158,4754,5218,5272,5657,5340,5755,5809,6232,5417,5839,5902,6290,5989,6343,6415,6741,4965,5290,5353,5808,5432,5889,5965,6316,5572,5976,6008,6409,6134,6381,6525,6832,5683,6062,6170,6491,6233,6556,6609,6890,6299,6615,6614,6979,6733,7017,7069,7304,5098,5412,5522,5977,5653,6009,6095,6451,5739,6157,6191,6550,6268,6571,6613,6933,5816,6241,6320,6603,6356,6619,6737,7019,6443,6756,6797,7075,6866,7139,7182,7417,5950,6340,6403,6739,6523,6750,6852,7096,6542,6840,6898,7159,6960,7211,7284,7500,6575,6948,7007,7235,7052,7290,7260,7525,7123,7341,7370,7596,7434,7630,7677,7787,2605,2889,3042,3567,3170,3768,3882,4392,3250,3918,3979,4433,4068,4539,4555,5138,3272,4043,4132,4538,4171,4767,4838,5246,4322,4844,4949,5368,5000,5445,5523,5986,3302,4146,4265,4789,4330,4931,4980,5422,4393,5028,5084,5538,5146,5633,5680,6022,4467,5110,5181,5644,5262,5734,5775,6142,5308,5757,5849,6240,5868,6288,6341,6815,3669,4323,4381,4987,4439,5085,5139,5596,4581,5197,5240,5712,5317,5792,5838,6162,4674,5245,5352,5764,5419,5866,5879,6260,5480,5885,5900,6349,6060,6388,6475,6834,4755,5418,5456,5896,5550,5957,5985,6363,5636,6059,6113,6442,6204,6510,6551,6905,5707,6153,6236,6553,6304,6600,6685,6963,6395,6692,6758,7028,6798,7081,7148,7410,3712,4417,4548,5173,4672,5241,5329,5800,4740,5359,5423,5888,5497,5907,5931,6360,4869,5457,5547,5933,5635,6048,6091,6436,5699,6140,6202,6534,6261,6576,6653,6912,4981,5577,5671,6097,5784,6171,6163,6581,5817,6244,6280,6622,6369,6689,6711,7033,5906,6305,6391,6704,6437,6769,6804,7100,6484,6828,6879,7160,6975,7225,7287,7509,5072,5722,5791,6246,5878,6297,6377,6693,6043,6394,6460,6787,6464,6812,6859,7137,6063,6462,6483,6845,6597,6878,6952,7208,6674,6972,7005,7236,7065,7314,7348,7534,6141,6611,6642,6915,6718,6985,7016,7273,6759,7057,7103,7338,7149,7376,7427,7605,6885,7111,7173,7383,7232,7440,7467,7667,7275,7489,7523,7687,7567,7734,7779,7902,3845,4588,4712,5362,4859,5449,5539,5995,4896,5560,5643,6057,5713,6120,6231,6659,5034,5681,5795,6159,5857,6295,6263,6676,5892,6321,6384,6755,6456,6779,6818,7124,5263,5828,5893,6291,6042,6362,6404,6796,6056,6459,6473,6819,6522,6862,6889,7191,6068,6504,6562,6887,6672,6951,7001,7239,6706,7045,7064,7321,7110,7349,7397,7589,5316,6029,6045,6438,6073,6463,6533,6874,6152,6598,6639,6935,6690,6992,7054,7295,6390,6661,6730,7003,6763,7078,7113,7343,6867,7120,7178,7389,7234,7436,7455,7661,6472,6768,6844,7080,6886,7156,7196,7407,6958,7221,7246,7452,7291,7491,7532,7709,7014,7282,7330,7522,7367,7558,7588,7742,7414,7599,7625,7770,7646,7815,7824,7971,5343,6081,6119,6651,6361,6681,6710,7043,6413,6751,6783,7087,6856,7131,7189,7399,6479,6816,6881,7141,6927,7199,7249,7445,6994,7288,7241,7481,7344,7527,75 66,7717,6675,6891,6950,7227,7031,7264,7323,7518,
7073,7331,7366,7559,7395,7569,7609,7765,7152,737
9,7424,7
593,7473,7634,7655,7803,7498,7682,7706,7838,7735
,7860,7864,7942,6766,6953,7070,7336,7127,7360,73
80,7582,
7183,7431,7442,7618,7483,7635,7695,7822,7193,747
9,7520,7680,7564,7710,7715,7862,7601,7744,7761,7
879,779
6,7906,7923,8009,7298,7550,7560,7730,7614,7746,7
776,7885,7644,7802,7808,7918,7843,7924,7973,8030
,7673,78
35,7857,7952,7882,7957,7988,8051,7895,7992,8006,
8066,8020,8078,8087,8126,3942,3713,3247,4737,364
8,4635,4
242,5502,3821,4247,4331,5322,4432,5016,4893,5690
,4077,4416,4529,4948,4640,5210,5092,5897,4822,51
32,5248,
5623,5372,6049,5786,6355,4143,4569,4671,5153,483
9,5221,5393,5731,4897,5459,5295,6228,5573,5829,5
918,681
3,5001,5413,5645,5867,5536,5984,6149,6587,5714,6
118,6044,6408,6259,6660,6465,7102,4297,4764,4852
,5341,49
82,5444,5603,5932,5111,5763,5467,6005,5682,6069,
6188,6482,5219,5569,5859,6143,5787,6348,6112,654
3,5658,6
203,6386,6610,6294,6872,6702,7340,5309,5856,5715
,6269,6013,6230,6424,6641,5916,6505,6330,6776,64
05,6717,
7044,6940,6082,6450,6527,6899,6586,6788,6833,713
8,6643,6973,6877,7283,7029,7472,7209,7656,4502,4
923,507
3,5546,5180,5641,5762,6155,5291,5948,5693,6210,5
831,6266,6368,6738,5388,5785,6023,6289,5901,6474
,6333,67
07,6072,6412,6563,6799,6511,6854,6955,7176,5488,
5994,5869,6380,6190,6457,6577,6825,6148,6665,647
8,7056,6
623,6894,6913,7242,6274,6560,6754,6954,6691,6991
,7092,7494,6821,7122,7036,7271,7188,7351,7396,77
00,5634,
6058,6237,6535,6124,6596,6713,6971,6313,6780,663
8,7155,6835,7004,7083,7320,6389,6684,6855,7048,6
934,711
4,7238,7363,6757,7203,7130,7444,7280,7416,7524,7
758,6461,6884,6961,7213,6786,7161,7255,7549,7015
,7310,73
57,7454,7184,7597,7501,7944,7068,7339,7388,7583,
7419,7529,7568,7813,7286,7622,7647,7729,7676,788
7,7778,8
071,4715,5133,5244,5765,5398,5956,5848,6354,5448
,5884,6172,6422,6028,6500,6570,6876,5602,6090,59
87,6532,
6185,6705,6468,6932,6296,6599,6736,6984,6650,713
6,7079,7485,5706,6211,6121,6814,6402,6580,6658,6
993,626
7,6688,6767,7228,6841,7039,7115,7371,6439,6875,6
789,7154,6962,7095,7233,7413,6909,7202,7268,7439
,7319,75
06,7591,7724,5793,6524,6247,6719,6342,6888,6778,
7172,6469,6824,6943,7125,6990,7212,7274,7474,660
8,7049,6
914,7353,6863,7230,7265,7571,7121,7307,7377,7510
,7415,7547,7627,7833,6680,7074,6988,7285,7143,73
42,7441,
7613,7224,7480,7359,7578,7394,7685,7650,7807,701
8,7430,7528,7671,7490,7640,7752,7800,7561,7732,7
701,787
4,7789,7853,7907,8082,5964,6376,6552,6873,6640,6
926,7086,7294,6716,7180,6959,7337,7037,7248,7418
,7611,64
90,7002,7071,7392,7158,7507,7356,7595,7247,7449,
7484,7678,7306,7743,7648,7972,6817,7101,7210,754
2,7297,7
466,7437,7720,7142,7496,7585,7666,7557,7696,7769
,7859,7381,7573,7526,7707,7612,7817,7749,7881,76
51,7780,
7836,7917,7809,7900,7989,8029,6880,7231,7329,749
5,7181,7619,7533,7728,7411,7546,7675,7762,7584,7
788,784
0,7936,7272,7641,7603,7795,7681,7856,7811,7932,7
740,7828,7890,7913,7873,8005,7978,8054,7451,7711
,7658,78
51,7767,7948,7830,7967,7623,7892,7865,7986,7878,
7997,8019,8141,7703,7939,7919,8034,7905,8012,804
4,8092,7
961,8039,8027,8109,8063,8161,8100,8173,5067,5323
,5526,6001,5670,6061,6173,6574,5758,6351,6135,67
40,6262,
6620,6808,7082,5858,6205,6425,6664,6317,6923,673
2,7135,6501,6858,6989,7350,6829,7177,7226,7516,5
930,641
4,6357,6782,6526,6853,6970,7240,6673,7053,6895,7
192,7032,7281,7405,7577,6601,7000,6949,7270,7094
,7372,73
22,7551,7157,7393,7448,7777,7476,7660,7626,7850,
6094,6458,6652,6922,6781,6974,7206,7305,6561,700
6,7112,7
352,7038,7435,7361,7604,6762,7140,7179,7505,7072
,7404,7482,7674,7289,7521,7429,7643,7570,7702,77
47,7899,
6908,7198,7328,7453,7254,7543,7511,7719,7378,761
6,7579,7697,7504,7753,7783,7888,7237,7633,7600,7
763,767
9,7829,7804,7933,7563,7797,7844,8001,7872,7977,7
956,8075,6281,6809,6618,7093,6712,7318,7055,7477
,6942,71
34,7243,7463,7220,7426,7538,7725,6904,7382,7269,
7590,7197,7519,7499,7757,7358,7565,7645,7705,761
5,7790,7
814,7921,7030,7299,7412,7548,7443,7670,7608,7834
,7311,7594,7714,7806,7642,7781,7863,7949,7478,76
98,7669,
7819,7759,7894,7846,7969,7745,7870,7926,7984,790
4,8008,8016,8115,7153,7488,7362,7657,7425,7624,7

708,7854,7517,7786,7686,7839,7731,7877,7891,7990,7562,7764,7721,7901,7818,7884,7937,8052,7798,7959,7908,8004,7950,8026,8041,8090,7602,7727,7831,7920,7782,7934,7966,8021,7867,7996,7946,8038,7985,8047,8065,8107,7852,7970,7998,8083,8018,8056,8070,8129,7954,8077,8094,8122,8101,8135,8148,8178,6506,6857,6777,7261,6978,7315,7229,7535,7042,7190,7428,7672,7373,7572,7631,7799,7097,7398,7345,7592,7497,7748,7617,7825,7475,7649,7699,7876,7726,7845,7909,8000,7207,7508,7450,7659,7556,7684,7704,7855,7406,7718,7768,7912,7810,7897,7886,8011,7598,7771,7832,7883,7801,7927,7951,8032,7756,7962,7922,8023,7980,8049,8062,8117,7296,7438,7610,7766,7539,7741,7823,7915,7668,7861,7791,7898,7654,7938,7955,8037,7694,7812,7837,8003,7866,7947,7974,8086,7893,7994,7963,8046,8015,8057,8080,8125,7733,7842,7916,7975,7875,8024,7995,8067,7943,7987,8033,8073,8007,8105,8088,8132,7903,8022,8045,8091,8058,8112,8102,8145,8040,8097,8123,8153,8116,8139,8157,8181,7462,7576,7632,7816,7716,7889,7805,7960,7683,7847,7841,7991,7880,8010,7981,8079,7760,7925,7871,7976,7945,7999,8035,8072,7914,8025,8043,8089,8017,8098,8111,8144,7794,7896,7968,8013,7935,8048,8028,8095,7953,8036,8055,8127,8076,8103,8106,8152,7993,8069,8085,8110,8064,8133,8118,8150,8050,8121,8138,8165,8131,8156,8163,8187,7858,7958,7979,8068,8014,8042,8084,8113,8002,8053,8074,8119,8093,8136,8128,8159,8031,8081,8096,8134,8104,8124,8143,8169,8108,8147,8140,8162,8151,8167,8171,8190,8059,8099,8114,8142,8120,8146,8155,8166,8130,8154,8149,8174,8160,8175,8170,8186,8137,8158,8164,8176,8168,8177,8179,8183,8172,8180,8182,8185,8184,8191,8188, 8189]

**Sequence group 7: Q7_16384**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1026,520 ,288,528,192,544,70,44,131,81,50,73,15,320,133,52,23,134,384,76,137,82,56,27,97,39,259,84,138,145,261,29,43,98,515,88,140,30,146,1028,71,262,265,161,576,45,100,640,1025,51,148,46,75,266,273,517,104,162,53,193,1032,152,77,164,768,2048,2049,268,274,518,54,83,57,521,112,1024,135,78,289,194,85,276,522,58,168,139,99,86,60,280,89,290,529,524,196,141,1040,101,147,176,142,530,321,31,200,90,1056,545,292,322,532,263,149,102,105,304,296,1030,163,92,1033,47,267,385,546,324,208,386,150,153,165,106,55,328,1088,536,577,548,1034,113,154,79,269,2050,2052,108,578,224,166,519,552,195,270,1041,641,1036,523,275,580,291,59,2056,2064,169,560,114,277,156,87,1152,197,116,170,61,1042,531,525,642,281,278,526,177,293,388,1057,2080,2051,91,584,769,198,172,120,201,336,4096,4097,4098,4100,62,282,143,1029,1044,103,178,294,93,1058,644,202,592,323,392,297,2053,2112,770,107,180,1280,151,209,284,1027,648,94,204,298,400,608,1089,352,325,533,155,210,305,547,300,109,1048,184,534,1060,537,115,1090,167,225,326,306,772,157,656,329,110,2057,2054,117,212,171,1038,776,1064,330,1153,226,549,1043,538,387,308,216,416,271,279,2065,2058,158,337,550,672,1092,118,332,579,540,1072,389,173,1037,121,553,199 ,784,179,228,338,2066,2176,312,1536,704,1154,2060,2081,390,174,554,581,1046,393,283,122,448,353,561,1096,203,63,340,394,1049,1281,527,582,556,181,295,1059,285,232,2113,2068,124,205,182,643,1156,562,2304,2082,286,585,299,354,1045,211,401,1104,4104,4112,4128,4099,185,1061,396,344,586,645,1282,593,535,240,1050,206,95,327,564,800,2072,2084,402,356,2055,2177,307,301,417,1160,213,1066,568,1120,832,588,4101,4160,4105,4102,1035,1537,186,646,404,1091,227,896,594,418,302,649,2114,2560,771,360,539,111,1052,331,1168,214,2059,2088,309,1062,1284,188,449,1073,217,408,609,596,551,650,229,159,420,310,1093,541,2116,2178,4113,4106,4114,4224,1288,773,610,657,333,1065,119,1098,600,339,1184,218,368,652,1031,230,8192,8193,8194,8196,8200,8208,8224,8195 ,391,313,450,542,1538,334,2067,2061,2096,2062,1076,233,555,774,175,123,1155,658,2120,2305,612,341,777,220,314,1105,424,1068,395,673,583,355,4108,4129,4161,4116,1296,1094,287,183,234,1051,2069,2180,125,557,1216,660,616,342,2083,2306,316,1157,241,778,563,1074,345,452,397,403,1112,207,2074,2561,1540,674,558,785,1100,432,1039,357,187,1162,236,664,1312,624,587,780,108

0,1122,2128,2085,705,126,242,1063,2073,2070,565,3
98,346,
456,2184,2308,358,405,303,569,1544,244,1158,1097,
595,1283,189,566,676,1169,1054,1108,361,706,4352,
4130,41
20,4132,589,1344,215,786,647,348,2312,2086,419,40
6,2562,2144,464,680,2115,2089,801,1069,362,1164,2
192,207
6,590,409,1286,570,1121,788,1552,1106,597,1075,57
2,1186,219,311,4103,4225,4162,4608,708,598,1289,6
01,651,
421,792,802,2117,2090,611,1047,602,1172,410,231,6
88,653,2564,2097,1128,248,1070,369,2122,2320,190,
364,156
8,654,1095,659,1161,335,480,315,221,370,1285,613,
4107,4136,4164,4226,1408,422,2208,3074,425,451,2
568,2336 ,4115,4109,4144,4110,1077,614,543,1298,2
35,412,343,372,2576,2240,1185,775,317,1539,222,10
99,426,453,237,1
124,559,1170,2592,2118,1292,833,804,712,1082,834,
661,1053,2092,2179,2129,2098,808,779,1217,617,60
4,1541,4
33,720,816,1101,2121,2063,1176,836,347,897,4168,4
353,4117,4228,1136,243,1297,662,1600,454,318,675,
2368,21
81,1110,618,4131,4354,4122,4609,1081,898,781,131
4,1220,376,428,1546,2100,2071,665,736,567,1107,21
82,2432,
8197,8256,8201,8198,8209,8202,8210,8320,1192,107
8,2124,2185,840,625,238,1159,359,457,399,787,2130
,2104,5
91,678,434,677,1290,1542,2075,2145,349,1300,1102,
245,1188,458,666,1113,620,1553,4176,4133,4121,41
18,1163,
1313,363,127,4232,4356,4360,4134,1067,191,1125,7
82,407,436,2087,2307,626,1218,2132,2186,571,465,2
193,230
9,681,246,707,1346,8204,8225,8257,8212,8448,8226,
8216,8228,2077,2091,2146,2563,350,1084,599,668,1
548,790,
2136,2188,1165,1320,460,1123,1200,249,682,1664,5
73,1171,411,803,4610,4192,4163,4137,1116,789,130
4,709,36
5,440,628,689,2078,2194,374,1224,3076,2119,423,15
56,4240,4124,4165,4138,466,793,2310,2313,2209,26
24,1130,
250,371,1174,2093,2148,481,574,1348,413,1109,603,
366,1545,1287,1055,468,1570,655,900,805,615,1166,
684,140
9,710,2688,3073,1187,429,4612,4145,4170,4368,819
9,8321,8258,8704,8203,8232,8260,8322,2099,2196,7
94,252,1
114,373,605,1232,848,690,2094,2123,713,632,2314,2
321,1316,482,806,1132,2565,2152,1083,427,1177,90
4,1569,4
14,2210,2101,1291,223,1126,1554,663,692,835,1328,
619,472,2241,3080,1137,455,4256,5122,4616,4384,4
624,428
8,4640,4166,2200,2125,796,1189,1601,809,714,1248,
721,837,716,1086,2212,2816,1302,1352,4140,4227,4
177,414
6,864,810,1173,606,1194,912,1103,722,696,377,2316
,2322,1424,435,2566,2102,1293,1560,817,1129,1792,
319,621 ,1180,8211,8205,8240,8206,8264,8449,8213,
8324,2131,2105,2569,2160,812,484,1345,430,1572,1
138,3072,2183,4
169,4111,4416,4229,1299,838,667,1219,2126,2337,4
88,1111,239,378,459,622,4148,4119,4230,4480,1410,
627,224
2,2133,437,380,1201,1608,818,1178,2324,2570,1294,
461,1543,496,669,1190,1317,679,2106,2216,1140,10
79,4172,
4233,4178,4152,2187,2147,1221,724,841,1305,629,1
584,2134,2108,351,467,2328,2137,1360,438,1115,73
7,2338,2
577,251,462,442,441,2572,2244,1666,469,1549,247,6
83,1196,2189,3088,2149,2195,4123,4193,4135,4355,
1226,84
2,1412,1127,738,1144,2224,2190,4180,4234,4241,43
57,1308,899,1602,670,1318,783,1085,849,4125,4139,
4194,46
11,1555,1193,820,1576,728,928,791,367,2578,2369,1
376,901,2079,2248,2138,3104,1233,630,2593,2340,1
321,685,
844,1204,633,711,2370,2580,2311,2197,2150,2153,1
118,253,691,1301,8227,8450,8218,8705,8272,8229,8
217,8214 ,824,1175,2352,2344,902,686,1668,1222,14
16,1133,740,1347,4184,4236,4126,4242,850,375,155
8,444,5124,4167,4
358,4361,1306,470,1167,483,4257,4672,4141,4196,1
547,415,3078,2211,485,905,2140,3081,4736,5121,41
47,4244,
1202,795,473,1240,2095,2315,634,744,2433,2594,16
16,852,2372,2256,2434,2198,960,1322,2201,2213,86
5,693,21
54,2103,1131,1794,1350,797,8328,8452,8456,8230,8
706,8288,8259,8233,1225,1604,1571,906,2376,3136,
1252,715 ,1141,1330,807,474,636,1179,694,254,4142
,4171,4362,4369,1550,1665,2584,2625,717,1071,259
6,3082,1315,575,9
13,1440,798,811,379,1208,4613,4200,4258,4149,216
1,2202,1353,1191,2127,2317,697,1564,4289,5128,42
48,4173,
431,1142,607,1228,2156,2626,489,1324,2272,2214,8
66,723,2567,2600,486,1573,1181,1234,908,1793,156
1,718,81
3,1364,2243,2318,476,856,8336,8220,8261,8234,870
8,8241,8266,8464,3089,2689,1117,1411,4260,4864,6
144,6145 ,839,1329,1295,1146,4364,4370,4614,4150,
8352,9218,8712,8480,8720,8384,8736,8262,3084,257
1,725,698,1472,9
14,2323,2628,1249,752,868,819,1349,814,439,929,41
79,4153,4617,4208,2339,2107,1197,1578,490,1139,2
217,260
8,1680,623,2162,2325,1632,1336,671,1198,1362,739,
2204,2135,1603,1557,3200,2245,5120,4231,4174,438

5,2164, 2218,1413,916,1303,463,1236,843,2109,3090,1135,381,1672,1354,2579,2573,4290,4181,4372,4618,4154,4264,4235,4195,497,1586,930,821,2690,2329,726,961,1203,1182,2326,2574,872,1418,492,1250,1332,631,2225,2341,4182,4156,4376,4185,2436,3105,1574,1223,729,1145,1605,700,8236,8323,8273,8242,8265,8207,8512,8325,2139,2632,1796,443,2817,2246,1307,741,2220,2168,1378,1562,1356,1205,845,1319,4386,4625,4620,4292,2249,2384,920,382,8244,8215,8326,8576,8268,8329,8274,8248,2110,2330,1585,822,1425,851,2191,3077,3092,2151,1229,730,1609,498 ,2226,2342,4237,5136,4197,4243,880,1256,742,445,1392,471,2141,3106,4272,4238,4626,4417,2692,2250,2640,2371,4127,4296,4186,5152,635,1148,1696,932,1580,687,2440,2345,1210,1420,1612,1325,1800,903,1134,825,4641,4388,4418,4628,1235,1361,500,1577,846,1670,1195,745,2818,2155,2228,3328,4359,4245,4198,4201,826,732,2199, 2257,2332,3075,1264,446,2696,2142,962,1426,1620,936,2252,2346,1377,475,2448,2656,8219,8289,8231,8451,8276,8330,8337,8453,3137,2400,2373,2581,853,1310,867,637,8221,8235,8290,8707,8280,8332,8222,8338,2203,2258, 1551,1230,2353,2595,1414,907,1206,1667,1588,1333,4400,4392,5126,4259,487,1808,2348,2157,4188,5129,4143,4363,695,1441,1087,746,4481,4642,4420,4304,828,753,1610,854,1237,1326,3096,2232,4482,4246,4249,4261,4202, 4151,4424,5184,857,1368,2582,3108,1209,504,799,1355,2585,2163,255,964,4632,4673,4644,5130,3138,2215,2273 ,2374,1242,909,2354,2820,2205,2704,1673,1559,1309,719,2377,2158,1143,477,2165,2260,1617,915,1448,1380,9220,8263,8454,8457,8353,8768,8237,8292,2219,3086,638,748,2824,3112,944,1728,1331,1227,869,1592,1428,491,699,1253,4209,4250,4175,4365,1351,754,2378,3201,6146,6148,4204,4674,1183,1565,2274,2597,8832,9217,8243,8340,8238,8267,8458,8465,858,1618,1417,1476,4320,4262,4615,4648,4291,4366,5137,4737,3091,2586,478,968,1260 ,383,2435,2356,5132,4619,4371,4676,1212,910,1801,815,2264,2464,1579,976,2319,2327,870,1684,1633,917,2206, 2385,2598,2720,3140,2166,1337,1241,2380,2627,1606,1824,727,1150,1442,493,1357,1251,2588,3120,1676,873,2437,2221,1384,701,4387,4155,6152,6160,3085,2169,1566,931,8709,8296,8354,8245,8385,9224,8344,8269,4265,465 6,4210,4373,1323,1798,1365,1473,2601,2247,756,1334,860,499,2832,2227,731,1648,1238,823,4252,4183,5248,4293,1575,922,1199,1674,4212,4266,4157,5138,2276,2386,874,1432,1421,918,2360,3584,4627,4621,4738,4377,2752 ,3202,1636,1254,2438,2222,502,1795,2602,2629,933,1366,4374,4622,4273,4389,3094,2441,1338,1682,2331,2170, 2496,2401,1587,1211,1488,743,1358,760,2609,3144,1244,1581,881,1147,4484,5153,6176,6147,2251,2111,494,1379,8356,8960,10240,10241,8460,8466,8710,8246,8275,8249,8713,8304,9216,8327,8270,8481,4187,4680,4865,4294, 1272,702,2388,2442,3097,3329,921,1624,501,876,2575,2630,1415,847,1856,1444,992,1697,2604,2229,4268,4216, 4297,4432,2343,3107,2333,2280,8386,8277,8468,8714,8250,8360,8331,8291,447,1607,1436,1369,2172,2253,1257, 1704,2230,2691,733,1797,3204,2610,1669,1340,1231,827,1590,934,4158,4378,4239,5125,2334,2633,1634,1474,5140,4199,4274,4390,2347,2402,3093,2259,882,937,2449,3152,2233,3109,963,1419,747,1265,2444,2392,4189,5154, 4740,4298,4688,4419,4488,4393,1119,505,1381,855,2634,2693,924,1810,3330,2641,2583,2288,6149,6208,4866,4203,8278,8252,8472,8281,8482,8721,8716,8388,3098,2254,734,829,1563,1213,2143,2375,4276,5376,4247,4305,1611,1363,2612,2848,1430,1258,1688,1386,965,1614,1730,1239,8333,9232,8293,8339,8368,8334,8722,8513,2450,2404,938,884,4380,5123,4744,4190,506,1327,1589,1804,2355,2349,2465,3208,749,1370,2261,3114,4300,4394,4496,4704,2616,3168,1640,945,2880,2636,966,1456,1681,755,3083,3585,2234,2694,1266,859,5185,4448,4421,4629,2452 ,3139,2275,2944,8223,8392,8282,9248,8737,8484,8514,8724,4251,4306,4401,4643,2642,2466,1427,1593,1388,940 ,2350,2697,1214,830,2819,2408,4396,4205,5144,4280,1809,911,1621,1582,4630,5156,4633,4211,2587,2159,1832, 871,3100,2379,639,1480,5186,4263,4321,4422,1698,1335,888,1372,1245,479,1422,1268,4402,4868,4253,4752,3216,2262,946,1732,2357,3110,1677,750,1802,1626,3332,2236,4425,4206,6153,6150,4213,4308,4267,5134,8455,8341 ,8294,8297,8496,8488,9222,8355,2497,3121,1393,969,2265,2456,2657,2644,508,1613,2599,2698,4872,5160,4426, 5249,8284,9225,8239,8459,8577,8738,8516,8400,2277,2207,861,1446,2468,2358,1857,1339,3141,2589,757,1382,3336,2821,970,1700,8578,8342,8345,8357,8298,8247,8520,9280,2658,2705,2381,3113,1243,919,2167,3146,1594,14
33,1826,1504,875,1635,1259,862,4322,4645,5139,46
34,2648,2387,1920,1675,4483,4404,4312,4512,4367,
4375,616
1,6154,3232,2266,1445,758,4254,4433,4646,4768,24
16,2700,1149,948,1359,1816,3079,2278,1596,1671,1
712,977,
5188,4214,4428,4675,4636,5168,4485,4269,5133,421
7,4649,4295,2439,2361,1385,923,1622,972,2498,259
0,1434,1
311,3586,2382,4880,4275,4324,4434,1729,761,1396,
877,3124,2281,2603,2822,2223,2171,3203,2706,1207
,1475,26
60,2389,8728,8769,8740,9226,8305,8346,8271,8461,
1449,1812,952,1686,2825,2268,495,1262,10242,1024
4,8300,8
770,8416,8358,8711,8744,2362,3153,1644,1619,2472
,3116,1341,1429,8387,8462,9233,8833,9228,8715,84
67,8772,
2443,2721,1825,703,6162,6272,4408,5632,1371,1638
,1567,1736,4800,5250,6156,6177,8483,8251,10248,1
0256,83
61,8752,8306,8469,2631,2403,935,1685,978,1625,33
44,3142,4486,4270,4650,4677,883,762,1246,503,514
2,4489,4
379,4218,2335,2231,1458,925,4544,4449,4657,5192,
4299,4159,4436,4490,1394,1269,2282,3099,5145,537
7,4623,4
678,878,1478,735,1799,4652,4277,4391,5155,2173,2
605,3264,2708,2664,2390,1678,1860,2364,3205,2289
,2826,26
11,3122,1443,1637,4381,4328,6209,6164,2393,2500,
1481,1373,2445,2451,3160,2255,1699,1255,993,1591
,1828,14
52,3588,2722,885,939,994,1400,8348,8279,9344,838
9,8308,8362,8253,9234,2606,2833,3148,2480,4220,4
301,4278 ,4739,1744,1656,3087,2405,5252,4658,640
0,6178,2235,3210,980,1689,926,764,2284,2712,1270,
941,1628,1367,18
05,1457,3360,2672,8723,8717,8834,8473,84
70,8718,8369 ,8485,4382,4681,4395,4450,2635,2828,
3128,3170,5141,4
307,4497,5200,1921,1583,2753,2174,8580,9249,1027
2,10243,8283,8776,8961,8390,1387,1642,2290,3111,
967,126
7,2613,2446,4281,5157,4492,4440,1484,1450,2394,2
504,4682,4741,5378,4689,886,831,1683,1342,4631,4
336,5146 ,4302,1811,947,2406,2453,2351,2617,3592,
2292,1705,1431,3206,3145,2643,3331,507,1261,1840
,889,2237,2614,4
191,4423,4660,4896,1650,984,1760,1490,6168,6180,
4498,4452,2724,3217,3102,3156,8364,8312,8393,852
8,12288,
12289,12290,12292,1615,751,2409,2754,2637,3392,2
263,2834,8254,8474,8335,9221,9236,8295,8370,8486
,6151,6
273,4403,4397,1702,942,1858,1423,2695,2396,1460,
1383,4513,5256,4309,5162,2467,2454,996,1692,1641,1814,97
1,1477,2512,2728,1273,1512,1733,890,1598,1374,82
85,9250,8836,8394,8784,8515,8584,8489,4664,5216,
4928,468
4,2849,3117,2410,3212,509,1806,2638,2457,5131,56
33,4282,4742,3334,2618,1922,1649,4500,5187,4323,
4992,316
9,2836,3600,3154,949,973,2645,3123,2620,3234,139
7,1489,4690,4514,4398,4745,2267,2359,2756,2646,6
210,6656 ,4867,4456,10245,10304,8962,8299,8372,9
472,8343,8401,4635,4207,5148,4427,3337,2649,1708
,1627,2699,2469,1
000,1690,2840,2850,892,1274,5264,4310,6155,6184,
2659,3095,1438,1817,2650,3220,2458,2279,4405,515
8,5380,4
284,8476,9219,8840,8286,8396,8490,8592,8800,9281
,8544,8517,8725,8347,8402,8497,8739,1390,1464,27
36,2701,
1868,950,1151,1731,4545,5169,4313,4504,1506,1827
,1597,863,3176,2296,3118,2417,4705,4692,4647,474
6,1451,7
59,2238,2412,1864,1714,3616,2702,3143,2707,1701,
1395,4325,4255,4516,4406,8492,8301,9240,8376,872
6,9252,8
729,8307,5189,4637,6212,6274,3209,2383,2528,2363
,1803,1008,2269,2418,3333,2661,1623,1482,5384,48
69,4706,
4753,3456,2470,1276,510,4429,5161,4215,5194,2473
,2499,1435,1652,4696,4435,5280,4314,3125,2662,25
91,3346,
2283,2460,2391,2420,979,1492,3233,2823,9282,8359
,8417,8518,8498,8964,8349,8848,4464,4748,5127,43
26,953,1
928,1829,1389,4487,4409,4546,4638,2365,3587,1738
,763,2270,3147,1872,974,5634,4430,6163,6157,6192,
6158,51
72,4329,2474,2501,1453,1643,2285,3172,1713,1818,
4651,4870,4271,4219,8521,8302,10249,10246,8309,8
404,836
3,9230,1215,1402,2607,3218,1629,1520,1830,1691,3
340,2881,954,1459,5251,4754,6216,6401,8968,9256,
8522,934
5,8418,8741,9235,8730,4708,4437,4873,4316,4410,5
201,4520,5164,8579,8500,8408,8608,8463,8471,1025
7,10250,
1734,879,2852,2760,3130,2882,981,1505,2709,3101,
1706,982,4491,4769,4679,4451,2856,2827,3265,2665
,2652,35
89,2481,2768,2864,3149,1924,927,3224,2884,1833,1
639,8350,8529,8742,8864,9284,8310,8524,8771,2395
,2945,31
84,2291,1447,1746,3345,2710,1343,1679,3648,2502,
2366,2723,1820,1761,5392,5190,4383,4279,4330,514
7,6165,6
276,8732,9264,8581,8365,9229,8313,8745,8391,1479
,1275,995,1740,4221,4653,5312,4756,4712,4438,617
9,6402,3
158,2666,1401,1888,4412,5253,4337,4874,765,956,3

129,2946,2829,3362,1496,1861,4659,5170,4441,4548,3268,24 24,887,1437,4493,4499,5208,4303,6170,6657,5636,4770,4654,4881,5196,4528,985,1720,2476,3594,997,1630,1813 ,1462,5135,4453,4283,5258,2713,2784,2615,3155,4332,4760,5408,4720,3240,3126,1398,1645,2888,2673,2286,320 7,2407,2505,2447,2835,8976,8371,8420,8530,10258,10368,8504,9728,1848,1687,2639,2726,4683,4876,5176,5218, 8896,9346,10252,10273,8582,8366,8746,8773,1247,1716,2482,2725,3338,3590,1936,986,9238,8585,8475,8314,86 40,8545,8753,9288,1483,1651,1745,943,2397,3348,1859,1508,3150,2293,3236,2506,6224,6181,4801,4222,8395,82 55,8532,8586,9241,9473,8719,8774,8748,8373,8487,9251,8477,8424,10305,10260,1834,1454,2714,3161,4338,515 9,6169,6166,2668,3601,891,1841,998,1595,3211,3361,4661,4494,4442,4552,1278,766,1465,1709,8316,8397,8374, 8835,9348,8754,10496,10274,6280,6404,4454,4501,4399,4665,5640,4340,2411,2175,1764,1646,5254,5193,4691,5 379,4285,4662,4772,5265,3115,2239,3173,2830,2455,2484,1737,511,5150,5204,4457,4802,2674,3266,1485,1404,4 685,5440,4311,4882,2619,2513,1693,1866,2729,2294,2755,3394,4743,4444,6408,6182,1952,1491,988,1657,4515,4 502,6658,6240,1752,1807,2398,3132,2647,2716,3596,2838,1399,1844,3213,3368,2508,3171,1001,951,1654,1926,3 248,2297,8478,8777,8491,8546,9237,8403,8593,9296,2730,3712,1707,1391,4560,4776,6211,6185,12296,12304,12 320,12291,8377,9253,8588,8536,2621,3219,2459,2851,4897,5165,4458,5260,1002,1468,3164,2837,3352,2757,241 3,2488,8778,8837,9474,8785,8727,8432,9242,8398,8287,8519,8756,8992,10264,10276,8594,8548,6288,6172,4686, 4505,1836,1494,1873,1271,2676,2737,1694,893,5382,4666,5217,4884,10247,10369,8499,8493,8609,9352,8405,92 58,2422,3272,1923,1461,2471,3604,1748,1715,5648,5202,4693,5171,2514,2841,975,1862,4668,5282,4315,4407,89 4,1815,3178,2298,2419,3222,1497,1653,4804,4694,5385,4697,4747,4517,4888,4898,6213,6186,4707,5143,2529,26 22,3396,2461,4698,5268,4506,4327,3157,2651,2414,3593,1510,1762,3335,3103,2516,3618,1842,1375,2703,2948,2 853,2663,4784,4749,6660,6193,3214,2732,1703,1009,5224,4344,5166,4465,3457,2758,1466,1874,8760,9312,9024, 8780,12293,12352,12297,12294,6218,6416,4286,4460,3235,2477,955,1739,9227,9729,8378,8838,8596,9283,8419, 9088,2842,2300,3162,2421,2653,3280,2896,2738,5664,4750,5191,4755,1486,1930,2761,2680,1889,1004,1658,182 1,5257,4431,4576,4411,1718,1929,3364,2530,2854,3180,1599,1507,8786,8610,8494,8841,10306,10752,8963,8552, 3131,2475,1776,1405,3225,2952,3617,2462,8731,8303,9244,8523,9360,8406,10251,10280,4317,4466,5381,4709,1 735,1831,3339,2271,3174,3602,1493,1010,5504,4518,6304,7170,8501,9254,9476,8380,8641,9265,8409,8600,4521, 4547,6664,6432,2711,2740,2883,3376,5173,4710,4639,5394,1984,1455,2667,2520,4331,4508,4439,4468,957,1865, 3185,2503,8801,8788,8743,8842,8421,8351,8612,8502,6672,6336,5281,4871,2844,3237,3649,2857,4413,5635,431 8,5195,4522,4549,4333,5220,2762,3296,2769,2885,2764,3134,983,1710,3350,3400,958,1514,4655,5266,6688,6214 ,2912,2858,3221,2654,1876,1768,3242,2960,9285,8733,10308,10370,12305,12298,12306,12416,5388,4929,4900,4 808,1721,1938,3151,2770,9480,8965,8802,8849,8525,9257,8311,9290,2744,2425,1660,1500,5178,4930,4757,5149, 6188,6275,6225,6194,1403,1892,3472,2483,1819,1741,1516,987,4904,4875,5313,4713,3341,3608,1932,1463,2865, 3177,3840,2367,1012,1843,2669,3228,4700,5637,4529,4816,8792,8531,9376,8410,8560,8844,9223,8422,4912,519 7,6217,6159,5272,4932,4443,4993,1749,999,2860,2532,3393,2478,3620,3186,5232,4339,5393,4758,3347,2886,271 5,3267,5696,4550,4414,4771,1838,1277,2536,3159,6464,6277,5206,4714,2287,2426,2507,2670,3458,2675,1647,19 25,2485,2428,1498,1742,8583,8505,8642,8734,9730,8526,10259,10253,5177,4994,4877,5410,3249,3656,2866,322 6,10288,10254,9268,8425,8747,8966,8367,8315,5316,4472,4524,5642,6196,6167,4761,4832,1513,1880,1717,1016, 4663,5203,6278,6528,5288,5174,6220,6281,1953,1837,3342,2509,1867,1631,3591,2544,4936,4721,4334,5255,934 7,8850,10312,10497,8804,8533,8969,8412,8506,9297,8616,9260,8587,8865,8775,8547,2717,3238,1469,1747,3365, 2727,767,1904,4455,4553,4495,4883,1724,1524,3188,3127,6226,6200,4687,4774,4530,4773,5386,5638,12300,123 21,12353,12308,9488,9286,8479,8375,6171,6241,4445,5396,989,1406,1754,1822,3269,2772,2889,3353,51

98,4341,
5284,4554,8426,9243,10261,10372,8317,8749,9408,8852,2677,3632,2399,2515,4762,5209,4716,5649,3408,2486,3
163,2785,2299,2510,2490,2489,1835,1499,3714,2517,3597,2295,2731,3244,5259,5409,4459,4223,1944,1863,1890,
1467,8808,8534,10275,10498,8508,9349,8433,8970,1003,1522,3274,2890,3460,3175,2786,3192,5163,4287,5221,4
878,4503,4532,6183,6403,1763,1695,3356,2947,4722,5314,6228,6282,8755,9266,8537,8644,8589,8595,9304,8399,
4667,4561,6289,6405,3650,2718,1850,990,4777,4342,4803,5442,1005,1937,3366,2831,3133,2897,1722,1845,6173,
6187,6242,6659,4446,5180,4695,4764,3603,3241,1495,1655,10266,10753,9732,8866,8750,8977,9292,8624,5644,4
886,6232,6284,5261,5416,4556,5219,9231,8549,8379,9354,8428,8856,9504,8816,5296,4345,4778,5760,2868,3624,
2776,2976,2839,2415,1765,1956,4669,5267,4507,4899,3424,2949,1487,1750,5212,4885,5400,4805,8779,8972,927
2,9314,10320,10277,8897,8318,3281,2678,1869,1521,3369,2733,2892,3252,8434,9255,10265,10262,8757,8590,85
38,8648,4461,4536,4724,4785,2681,2759,959,1896,6174,6290,4470,5320,1263,1940,3166,2301,10376,10500,8550,
8597,8495,8761,9736,8436,2739,3349,2872,3223,1770,1877,2950,2734,3716,3270,1509,1711,3464,3181,2788,339
5,9350,9289,8787,9475,8381,8758,8868,9361,7172,6215,4519,5652,1756,1846,2898,2423,4562,4889,6406,6409,36
06,2492,1011,1960,3354,2518,3215,2531,6305,6720,5226,4346,9246,9300,8553,8898,12544,12322,12312,12324,8
781,9536,8407,8978,8839,8540,10504,10278,4467,5270,6189,6244,3595,2463,1784,1870,4577,4670,5444,4509,52
05,4699,4462,5641,1662,1013,2533,2953,5383,5151,4564,5666,8611,8598,10754,10336,8656,8872,10307,10281,4
751,4996,4901,4711,1985,1753,3250,2843,5262,4780,5505,4806,2521,3288,2682,2792,6784,7169,5283,4525,1927,
1528,3664,2900,6195,6292,4890,4348,1849,1882,3008,3370,5210,4469,4701,5328,4944,4786,6190,6219,2913,274
1,1766,1511,4809,4728,6410,6417,3179,3842,3398,2845,3273,3652,3619,2954,1954,1719,3300,2763,3189,3378,17
77,895,8993,9261,8554,9356,10384,10268,8782,8601,5412,4578,4902,5228,2855,2522,2684,3227,9478,8762,9313,
8980,9744,9298,8789,9267,8764,9378,8411,8503,12295,12417,12354,12800,6661,6248,5179,4523,2742,2302,1439 ,1006,8900,8790,9481,8793,8843,8613,8984,8994,5273,5000,5665,4510,3598,3713,1878,1891,2765,3119,3363,262
3,6306,6197,5387,4319,2961,3488,2846,2859,2427,3256,1939,1661,10309,10282,8803,9239,8794,9364,8602,8423,
8880,8845,10756,10289,9320,8440,9262,8561,10314,10512,8382,8556,9760,8846,9287,8851,5222,5650,4759,4788 ,3401,3239,1502,1986,2745,3612,1852,1934,4931,5424,4715,4568,2479,3190,2655,3276,6337,7176,5233,4551,935
3,8527,8672,8507,8413,8562,9477,8805,2537,3372,1723,1772,2914,2771,1515,1897,6296,6221,4892,5285,5697,49
05,4810,5344,4817,4933,4812,5182,6308,6912,5398,5448,2534,3621,3229,3282,4960,4906,5269,4702,2956,3841,3
609,2766,1014,1470,2861,3412,5290,5008,5199,4818,1743,1931,2524,2904,4792,4473,6412,6418,3165,3459,2887,
3377,5520,4531,6662,6198,3343,3194,2773,2746,5389,5656,4913,5225,3520,2962,1017,1968,12299,12328,12356,
12418,9600,8614,10400,11266,3297,2800,2916,2867,3397,2862,2487,2977,8617,8643,10760,10528,12307,12301,1
2336,12302,5888,4415,4717,5276,1881,1894,3245,3626,1769,1517,2538,3187,6227,6201,6665,6256,9269,8806,87
35,9490,8427,8604,8535,8564,1778,1941,1823,1659,3728,2671,1992,1875,10768,10432,9377,8967,8509,9731,841
4,9291,4908,4580,5441,4526,3680,3384,1755,1501,8618,8645,8429,9316,8751,9362,10784,10310,9484,9025,8996,
8904,9274,9026,8853,9245,2719,3246,3410,2787,5668,5234,7168,6279,10284,10371,10321,10290,9000,8971,9409 ,8809,1018,1900,3651,3605,1725,991,3461,2964,8796,9733,8625,8912,9008,9293,10313,10255,5395,4934,4763,53
15,6222,6433,4584,5207,4335,4474,4555,4718,3351,2511,3284,2891,5506,4723,6338,6229,4533,4476,5297,5704,4
914,5274,6420,6666,3183,2429,3720,3402,9368,9028,8539,9089,12360,12545,12309,12420,5390,4557,5639,4592,
2545,3634,2978,2869,4765,5286,5413,4775,6202,6312,5236,5175,2774,3009,3251,3230,1933,1839,2920,3466,254
0,3298,3380,2679,6283,6243,5317,4820,1525,1955,1988,1884,1726,1948,3622,3271,4937,5401,4725,5680,6230,62
04,4447,4563,9328,8435,9489,8854,9792,8646,8510,8867,2777,3193,3653,2748,6424,6233,5456,4534,10560,1037
3,9302,8810,12323,12546,12314,12801,5211,4833,64

34,6673,1780,1518,3844,2491,1020,1767,1905,1851,4347,4558,4538,4537,3355,2789,1893,1945,3426,3610,3404,3253,2893,3367,2968,2430,6668,6340,5762,4565,9273,9090,8973,9506,9412,8568,8620,9738,5645,4343,4779,5292,6285,7184,6245,6291,10292,10263,8857,8928,8759,9299,10374,10624,3633,2870,3473,2899,5322,4938,5508,5223,3277,2778,3657,2546,4834,5240,6320,6286,1757,1530,2928,3304,5404,4995,5698,4766,9384,9270,10316,10377,9032,8817,8430,9351,2790,2493,3440,2519,5414,4879,5181,4945,8551,8649,8591,8979,10322,10296,8783,8870,1958,1471,1007,2000,2683,3196,3744,2980,8626,8869,9482,9734,10267,10337,8541,9492,3628,2735,1847,1898,5651,5289,4916,5672,4824,5024,4887,4463,6674,6465,5472,4997,3258,3468,3660,3373,6175,6344,6234,7200,5329,4726,6689,6436,1523,1942,3848,2951,3182,2873,1961,1871,5417,4781,4940,5300,9294,8437,9380,8650,8858,9305,8812,9745,3283,3409,1771,1529,2548,3625,2894,3718,12368,12325,12313,12310,9355,9505,8555,8319,4729,4807,6466,6676,6407,6293,6246,6249,3243,2793,1912,1758,5214,4349,4787,5397,4920,5271,6448,6440,4998,4782,5764,5318,12424,12548,12552,12326,9259,8383,9317,8974,2874,2780,1989,1946,3312,2494,3010,3474,5512,5229,4836,5443,3668,2984,3425,2523,8599,8628,10279,10499,8818,9410,10324,10378,4946,4471,5654,4540,1526,1906,2901,3358,2915,2685,3599,3278,1883,1773,3462,2955,5402,4566,5263,4579,3254,3715,3636,3381,2535,3856,1957,1853,2743,3489,3135,2794,8763,8657,10385,10501,8873,8438,8899,9538,5643,4511,7174,6307,4581,5001,6236,7177,1976,1015,2876,2801,5298,4891,4569,5336,10269,10283,10338,10755,8542,9276,8791,8860,6191,6411,4730,4840,3658,2902,3285,3374,9740,8982,10328,10380,9357,9512,8652,9315,6529,6690,5712,4948,6468,6352,6530,6294,1751,1993,1503,1962,5056,5418,6297,6309,4961,4789,6250,6199,2905,3416,3257,2552,9392,8441,8874,9856,8765,9363,8603,8995,5227,5890,5446,4893,5321,5700,5667,5002,12802,12384,12355,12329,9308,8981,9496,8901,8557,8632,8820,8881,10270,10386,8566,9416,6472,7232,5348,4811,2847,3403,2303,3012,5237,5426,4903,4570,1781,1885,3290,2957,4732,5275,4790,4350,1908,2016,3721,3607,11268,10311,8615,9748,12432,12316,12357,12330,5646,5761,6680,6721,3357,2767,3191,2525,4813,5167,6692,7178,5411,4671,5009,5536,8658,8985,10502,10505,10401,10816,9322,8442,3665,2963,3496,3428,4894,4907 ,4475,5304,2686,2796,1854,1532,2992,3776,3379,3275,8563,9366,10285,10340,8673,8766,9540,8605,2917,3640,3476,2539,2747,3301,1972,1774,6257,6298,5449,5287,6223,6413,4793,5660,9301,8795,8558,9737,9479,9247,8660,9762,3399,2802,1019,1895,4527,5238,4703,5324,3231,3613,2906,3666,6252,6722,4585,5420,6368,6310,4962,4819,3465,3524,2526,3016,8847,9092,8997,8807,9358,8876,9601,8902,10880,11265,9379,8621,12804,12337,12362,12560,6663,6696,4582,5669,5277,5330,5004,5889,3308,2431,1987,1969,5657,4814,4909,5460,6339,6414,4572,4952,3260,2958,3849,2863,10291,10388,8986,8444,9306,8565,8797,9424,7185,6785,5213,5507,3627,3024,1782,1279,9040,8882,10286,10315,8905,8824,10506,10513,4935,5425,5391,5242,2918,3732,3681,2965,9508,8674,8998,9324 ,10757,10344,9275,8619,7180,6667,4821,4794,5568,5010,6419,6724,5345,4848,4964,4915,5445,4910,4535,5025,1943,1899,3385,3289,6435,6203,5293,5674,9369,9096,9761,8606,10402,10293,9483,8415,1994,1663,3654,3872,2775,3198,3490,2541,9318,9746,8855,8884,9027,9520,8811,8664,4586,5235,6313,6704,3405,3299,1964,1785,5776,4719,6258,6421,3724,2921,1021,1935,10433,11272,9329,8647,12448,13314,12808,12576,12816,12480,12832,12358,10392,10317,8988,9381,5728,5432,4767,5294,3432,2749,3614,2979,5458,4835,6300,6231,3371,3846,3413,3521,9793,9001,8906,9440,8913,9029,8908,9278,2804,3382,2908,2547,5699,5653,7296,6341,2779,3696,3286,2871,3623,2970,3247,3722,6260,6314,5509,5012,1886,2001,2922,3480,10404,11008,9494,9544,12332,12419,12369,12338,9056,9002,9365,8798,9386,9104,9295,8914,8888,8569,10508,10514,9616,8627,10758,10294,3469,2966,1407,1779 ,5399,4559,5332,4939,6205,7186,5231,4477,1990,1970,3684,3302,5768,5450,6675,6669,2550,3843,1879,1022,9485,9752,9009,9321,9984,8511,8813,9372,4593,5682,5026,4917,6786,6425,4822,5057,5299,5278,6422,6670,4968,5514,4588,5346,5428,4727,6321,6437,2981,3414,1902,1947,6532,7201,5670,5319,3386,3730,3635,3259,4825,5241,5 701,4796,6235,6728,5892,4539,3536,2791,3406,2808,6913,6342,5403,4837,3292,3629,2929,3195,6316,6264,5474,
5658,5452,5301,4941,5415,2542,3427,3320,2750,10323,10297,10761,10352,9004,8676,9537,8622,9764,9330,1126
4,10375,12361,12303,12608,12421,2969,3672,2549,2924,1759,1907,3463,2895,9491,9030,8859,9411,10318,10529 ,8680,9303,8431,8570,8651,8814,12340,12311,12422,12672,6345,6480,5016,4478,3904,3492,3040,3745,9602,881
9,10434,10325,8629,8572,9393,9800,1527,1996,1786,1959,6206,6426,5681,4918,5521,4947,6287,7173,2495,3655,
3484,3417,9010,9370,10516,10762,9486,8653,9735,8688,7188,6247,5325,4826,2002,1913,3305,3752,8861,9382,9
509,8871,10298,10408,9332,9271,12364,12425,12370,12344,10379,10339,9413,8916,9033,9497,8821,9776,10326,
10300,8543,8659,1949,2017,2781,3845,5705,4594,6322,6438,1534,1788,3717,3388,3279,2875,3638,2982,10520,1
0329,9552,8630,9307,8929,10530,10769,4976,5352,4838,4541,5488,4567,6237,7202,8443,8654,8634,8633,10764,
10436,9858,8661,6788,6346,6736,6467,3682,3522,2930,2985,4731,5244,5792,5028,5676,4783,6536,6441,5306,55
16,5708,5421,5896,4999,5230,4921,3011,3467,2795,3313,5331,5457,4596,5673,9741,8439,8875,9388,10381,1128
0,10341,10387,3167,2553,3429,2903,4942,5766,5291,4841,6914,6251,6324,7424,2972,3858,1910,1965,2782,2877,
3611,3261,3659,3411,2004,1901,4922,4828,6295,6353,3478,3306,3736,3434,6428,7171,5360,4542,6792,6238,505
8,5522,12315,12385,12327,12547,9418,9034,9604,9319,3013,3662,3778,3287,5716,5032,6348,6442,8930,9336,10
416,10382,12372,12426,12433,12549,5473,4571,6544,6752,1966,1775,2986,2932,2008,1531,2554,3375,7233,6496 ,6469,6677,9500,9091,9794,8862,9510,8975,9277,9041,3637,3852,1971,1950,2797,3418,3688,2993,12317,12331,1
2386,12803,9747,9385,9012,9768,8920,9120,8983,8559,10770,10561,9568,9093,4949,5406,4963,4733,3014,3504,
3729,2803,10271,10440,10330,11296,9425,8822,10785,10532,9513,8877,9036,9396,8825,8903,10562,10772,6299,
6354,5647,5326,6449,6691,5510,5003,5302,5763,5684,5429,3314,2907,1909,1991,10503,10389,10342,10345,9310 ,8445,8883,9493,4583,5904,6444,6253,3475,3641,3436,2988,9016,9367,10544,10536,9094,8878,9860,9414,4791,5
537,5183,4842,3262,2878,3857,2959,4924,4849,5706,4950,5333,5422,7192,6328,9608,9325,8932,9539,12376,124
28,12318,12434,3669,3630,3880,2919,2018,1727,2687,3528,9042,8567,9750,8636,13316,12359,12550,12553,3746 ,3383,2936,3420,4953,5464,6678,7204,5305,4600,4895,5451,6681,6259,4351,5060,3293,2527,3470,3316,7234,631
1,6369,6470,5338,5005,6450,6916,1916,1855,1974,1995,2994,3780,3725,2798,6301,6800,5769,5655,5405,4815,64
73,6254,3850,3674,3441,3017,9498,8662,9359,8675,12449,12864,12333,12388,5239,4573,6261,6356,5713,5011,5
544,5476,9739,8607,11270,10403,8677,9097,10332,11273,2020,1977,2556,3661,6315,7182,4734,4844,6920,7208,
5040,5824,5427,5323,4965,5688,12928,13313,12339,12436,9394,8987,8665,9432,2909,3494,3905,3387,2805,3430 ,3018,3748,5524,4587,4795,5349,3291,2967,1787,1914,10287,10507,8826,8936,10625,10786,9808,9044,5447,485
0,6474,7297,3642,3481,3874,3552,5279,5661,6370,6693,2923,3683,3307,2910,10564,10448,10626,10390,9152,95
14,10393,10405,4954,5714,5513,5572,2005,1887,3968,3723,9057,8885,10346,10295,9323,9986,9542,8989,1023,1
963,3493,2806,7187,6682,4574,5064,5356,4479,6531,6452,3197,2996,3407,3864,9417,9796,9763,9098,10568,113
28,9444,8907,9333,9522,8999,8666,8828,9371,8886,8446,12334,12363,12554,12561,9742,9857,10776,10817,5308 ,5006,5897,4911,6360,6560,5675,5072,8909,9263,10788,11274,9507,8767,9105,9632,6415,6423,4966,5780,5729,5
013,6302,6481,3644,3719,3760,3025,6694,6816,7236,6262,5433,5337,6476,6723,3433,2971,3670,3020,5702,5920,
4823,5246,5538,4589,5453,5347,8990,9003,8571,9400,12805,12392,12450,12341,6684,7216,5772,4969,3482,3359 ,1998,1783,10353,10394,9545,9383,10319,10509,8889,9756,6533,6317,5480,4797,3777,2809,3444,2925,12481,13
320,12440,12365,8623,9334,8799,9420,7181,6265,5662,5027,2024,1980,3255,3523,5419,5894,5461,5569,6697,63
43,4852,5430,4956,4595,6928,6323,4827,5744,5334,4919,10348,10818,8681,9516,10464,10406,9058,8915,3497,3
860,3000,3734,5671,5018,5295,5770,2543,3310,1903,1973,3692,3667,3389,3477,10759,10792,8678,9765,9373,94
26,9100,9985,3873,2751,3419,3686,6372,6482,4970,5528,5517,5014,6456,7680,3615,3784,2983,3733,6848,7298,5
732,5350,3026,3673,2931,2810,6534,6318,4598,5891,6698,6725,5029,5462,9753,8910,9005,9556,10435,10510,86 68,9048,3294,2551,3506,2973,7190,6537,5434,5778,6427,6266,6592,6497,3442,3317,2003,1789,11281,10881,930
9,9603,12452,13056,14336,14337,9031,9521,9487,9338,12556,12562,12806,12342,5683,5307,5584,4839,5454,485
6,6705,7240,11276,10763,8917,8890,9664,9106,10515,10820,2926,3526,2783,3847,5340,5677,4977,5243,9441,89
44,9060,9011,9541,9006,8631,9121,1997,2032,3726,3908,6347,6207,4590,5475,12371,12345,12809,12400,10531,
10299,9389,9770,5368,4798,6484,6538,7193,7425,5017,5720,8682,9331,10409,10800,9872,8815,10354,10517,982
4,9528,8863,9390,9554,8931,10396,10327,4597,4972,6671,6726,5511,4943,5952,5540,5088,5793,6700,6325,1978,
1917,3491,3685,6439,7203,6429,6376,2010,1519,3529,3421,9795,9749,11392,10437,13312,12423,12366,12577,45
43,5703,5532,5465,6268,6349,5353,5800,3747,3303,3041,3639,6326,6787,4829,5893,10356,10410,9605,9108,949
5,8655,9428,9035,3876,3500,2933,2987,7300,6706,5765,5436,5327,4923,5686,5030,3042,3448,3792,3704,10301,1
1282,9327,8573,9864,9546,10771,10765,12482,12373,12564,12810,12346,12456,12427,12387,3028,3737,2974,28
12,6430,6729,5730,5570,3318,2989,3676,3415,3853,3505,2019,2006,8689,9778,9122,9013,10882,10521,8918,915
3,6443,6498,7189,6355,3969,3631,3435,3690,4978,5033,6545,7248,6329,7205,5059,5515,1951,1911,3015,3315,48
43,5361,6540,6488,9395,9374,10518,10766,9064,9610,8684,9442,9524,8823,10417,10533,12374,12348,12568,123
77,10628,11297,9766,9415,8921,9337,9797,8892,3532,3498,2021,2009,5215,4601,5477,4951,6730,6789,5020,590
6,7426,6737,6679,6384,10331,10824,9988,8635,11009,10438,9499,8933,7194,6350,4830,4925,5659,5309,6239,64
71,10412,10360,9570,9754,9548,9397,9037,9511,2934,2879,3731,3390,5707,5459,6708,6944,12578,12817,12812,
12484,10441,10576,9112,8574,5526,5354,5784,5482,5061,5710,5826,5335,6546,6500,5034,4980,3859,2995,3753,
3479,4602,5423,5685,5900,2555,3309,3888,2937,10302,10522,9777,9014,9617,9043,10383,11269,6451,6445,6561 ,7304,4845,5466,6357,7210,11284,10343,9421,8922,9801,8690,10418,10534,12429,13328,12389,12435,9072,9448 ,8934,8637,3698,3032,3808,3538,3663,2799,1790,2026,9584,8663,10333,11298,12464,12430,12818,12609,10884,
10442,10832,10563,12319,12488,12378,13344,3750,2990,3906,3471,6712,7264,5736,5041,3508,3431,3044,3740,6
976,6732,5062,5552,8827,9340,9888,9124,9772,8879,10632,10537,5777,4851,7179,7681,3689,3862,3019,3525,63
30,6790,5362,4955,1975,2012,3321,3560,9402,9612,9804,9517,9992,9095,9326,9017,3781,2938,3646,3422,6548,7
235,6371,7040,12833,12580,12610,12820,9427,9553,8692,9769,9038,9862,9387,8937,11010,10347,10420,11520,1
2551,12437,12390,12393,9018,8924,10391,10449,1967,1915,2557,3854,3970,3697,2997,3021,6738,6562,5523,568
9,5484,5036,6446,6793,10524,11267,9456,8638,10888,10334,9154,9618,5310,4926,6915,6504,5905,5007,5717,56
78,9812,9128,10444,10538,9569,8667,10640,10848,6683,6255,5928,4967,7196,6475,4735,5576,5794,5431,4984,5
468,5341,4575,5518,5364,3445,3537,3756,3675,7312,6358,5042,5828,6453,7206,5773,4846,5898,5722,7428,6332,
11329,10592,10565,10773,9045,9502,9059,8829,3048,3738,2940,3322,3486,3865,3438,3512,2025,2022,3916,2998 ,6593,7217,5489,5065,6361,6552,6753,6740,4604,5709,6695,6794,10395,10450,9743,9422,10545,10787,9606,909
9,9398,9859,9780,9525,12592,12584,13318,12451,3199,3779,3554,3875,6373,6303,4957,5542,8679,10000,10540,
10349,12380,13321,12335,12555,8887,9633,9279,8938,12673,12834,12612,12496,6564,6454,5953,5435,3645,291
1,1981,1918,9020,8945,9802,9046,9429,9518,11288,10424,2033,1999,3499,2807,7237,6685,4853,5478,7432,6917,
5066,5796,3912,3762,3749,3443,12674,12438,12441,12453,12394,12343,12616,13376,9049,9560,10774,11300,94
01,8696,8991,9547,6754,6801,6477,7209,3851,3056,3671,3530,10777,10355,8447,9156,12824,12865,12836,13322 ,11330,10407,10465,10566,9434,9101,10546,11012,10397,10896,9865,9751,9501,8911,10569,10350,5339,5015,62
63,7242,5690,5529,5922,5600,4971,5731,5355,4958,3324,2558,3483,3700,9335,8669,10357,10452,9809,9107,964
0,9572,6744,6483,6016,5771,3027,3540,3001,3976,10411,11278,8830,8940,11016,11304,9136,9920,7328,6362,55
41,4854,3877,3437,3786,2811,6512,6796,5245,5044,5455,5912,7175,6374,9523,9419,9061,9784,9620,8683,8891,9
445,5692,5767,5808,5073,2028,1533,3920,3022,12401,12442,12367,12557,9543,8946,10570,11393,3501,3691,376 1,3866,6535,6457,5481,5019,5718,5068,6594,6686,5530,5407,7682,6478,3263,3450,3677,3568,5825,4857,5492,49
73,7220,6377,6699,6918,3878,3739,3002,3507,6319,6267,7299,6802,5303,5571,6756,6485,14338,14340,12396,12
866,9375,9757,10466,10789,3782,2927,3029,3553,5545,5908,5048,5782,9050,9810,9609,9668,12512,12454,12807 ,12840,6921,6364,4591,5358,2011,1982,3754,3030,6458,7249,5740,5715,6568,7212,5437,5525,12483,12558,1332
9,12929,11283,10778,8670,9160,9452,8575,10627,10548,13324,12811,12563,12868,6539,6817,5921,4799,3972,29
75,3881,3687,9404,9102,9993,9007,10456,10656,9771,9168,10511,10519,9062,9876,9825,9109,10398,10577,3495 ,3794,2034,1979,5467,5734,5663,5832,10790,10912,11332,10358,9529,9433,10572,10819,9798,10016,8919,9342,
9634,8685,9549,9443,3391,3727,3868,3809,6727,6499,5031,5781,10780,11312,9868,9065,10629,10413,9576,8893 ,5074,5721,7440,7238,4979,4858,5342,4599,12579,12347,14344,14352,11277,10361,9758,9123,3527,3323,3043,3
788,6431,6327,5554,5021,12457,12848,12402,12565,9515,9990,9557,9665,3449,3936,2813,3004,5490,5365,6378,
7195,10793,10439,8948,9526,9052,8691,11024,10419,8923,9840,9430,9015,12444,12375,13440,12485,4974,5574,
4831,5895,3544,3909,2935,3485,9767,9114,9391,9866,12404,12458,12349,13330,6269,6701,7360,6804,6760,6486 ,5774,5956,6460,7301,6385,6922,6707,7218,5539,5733,3033,3768,3045,3678,6489,6596,5577,5469,6541,6547,725
6,6351,3861,3510,2023,2013,10468,10578,9066,9624,9613,9110,10552,11776,5795,5351,5089,5687,5924,5548,76
84,6818,12819,12813,12930,12569,10944,11394,9828,9446,4981,5035,5090,5496,3446,3693,2036,2007,10630,104
14,8694,9987,10794,10821,9125,9558,6702,6929,7244,6576,3896,3735,3295,3764,5840,5752,7183,6501,6331,730
6,5076,5785,12566,12814,12465,12581,11286,10633,9530,9874,5022,4860,6380,6808,5366,5037,5724,5463,5901,
5553,7456,6768,3984,3034,3531,3699,10523,10362,10688,10593,9779,9403,9680,8935,6731,6924,7224,7266,3793 ,2991,3907,3556,6017,5679,6849,6270,3882,3502,2939,3889,9550,8952,10801,11336,9436,9773,9073,9339,5483,5
738,6386,7207,5063,5363,6709,6542,12676,13345,14368,14339,10443,10303,8686,9571,5580,5546,6490,6600,304
6,3643,3326,2814,4982,4927,5779,5438,3513,3757,3812,3694,12379,12872,13057,12486,9464,8894,10580,10634,
11289,11521,9113,9816,8693,9068,10767,10822,9607,9039,10048,9636,9184,9889,10796,10421,12460,12408,124
89,12624,10535,11299,10525,10472,5907,5043,6502,6549,6447,6713,7688,6388,8639,9799,9628,9561,10364,1044
5,9449,9896,5801,5527,7302,7241,6739,7427,4603,5357,2030,2014,3785,2559,5936,4985,6333,6710,10422,10883,
8925,9989,11396,10802,9861,9532,3533,3452,3741,3914,5746,5080,5856,5586,9423,9019,9782,9126,12350,12570 ,12431,13317,6820,7313,7198,7252,5711,4847,6505,6850,10526,10825,9826,9666,13332,12391,12466,12582,6733 ,7488,6359,6930,5798,5038,5954,5519,10539,10594,11285,10451,9074,9129,10641,11344,6791,6492,5556,5479,2
040,1535,4000,3539,6563,6550,5092,5788,5737,5910,5067,5573,6608,6824,5369,5608,5829,4986,5694,5470,1042
5,11301,9155,9611,8939,9457,10636,10584,3036,3705,3800,3855,6945,7213,6506,7308,3447,3892,3049,2999,460
5,5902,6734,6553,12381,13346,12932,12490,12880,12611,12680,12585,3702,3974,3755,3439,3050,3516,3884,354
2,7430,6714,6018,5745,3921,3319,3742,2941,9311,8697,9573,9047,10826,10885,9116,10002,7265,6932,7696,725
0,3971,3509,3796,3763,5045,5069,6741,7219,6716,7330,5493,5585,11522,10833,10775,10480,14341,14400,13058 ,12395,2027,2029,3023,3910,6363,6455,6852,6742,2942,3863,2035,2037,7433,6745,5804,5723,11290,10446,8926,
9021,9755,9405,10335,10567,12468,13568,12439,12497,9803,9555,10804,11040,9622,9450,9880,9578,9157,9806,
9922,9431,6795,6565,5096,5786,6936,6946,4988,5370,10642,10596,9130,9076,12572,13315,12936,12382,8698,95
19,9781,9996,10547,10541,10657,11400,8941,9562,10453,11306,12492,12586,12688,12896,6755,7191,5534,5913,
6746,7316,6554,6375,10808,11360,9832,9137,11072,10828,9158,9648,5486,5560,6832,6797,5964,5046,5247,5827 ,9873,8947,11275,11777,10426,10886,9458,9051,13377,12640,12613,12821,10644,11331,10467,11136,5602,5923,
5693,4959,7272,6392,7214,6513,3545,3701,3558,3810,5547,4855,6334,6508,5960,5810,7712,6798,7239,6803,579
7,5491,12443,12498,12593,12835,10834,10658,9619,9785,3890,3423,3751,3057,3514,3922,3003,3787,3534,3978,
3937,3052,7305,6479,6624,6459,9580,9132,10542,10889,9406,9022,11011,10600,12588,12397,13336,12472,1000
1,9103,9813,9774,5899,5104,6365,6514,7429,6757,5719,5578,12822,13348,12825,12403,10779,10351,10

024,9063 ,11292,10571,8831,9672,13378,12455,12513,12614,3706,3869,3766,3977,7552,6566,5372,4606,1791,2038,3647,3555,3824,3453,3783,3879,9890,9527,9080,9564,9437,8671,9614,9460,6569,6595,5531,5748,3541,3058,4032,3503,7221,6758,6687,7442,6379,6556,6487,6516,5075,5588,7329,6919,5049,6024,5925,5485,12594,13060,12445,12944 ,11408,10454,9138,9924,10549,11302,9869,8942,9994,9818,11524,10428,12617,12398,14345,14342,12405,12500,12459,13326,6461,7683,5834,4859,6366,7243,5968,5070,10689,11313,9585,9161,10457,10648,10849,10836,6570,6597,5549,5739,6381,7268,5809,5914,8700,9805,10791,10890,13064,13352,12618,13441,3005,3913,3031,3758,5311,5498,6703,7314,10469,10399,9053,9638,10660,10550,10049,9531,5725,5616,5926,5787,7436,6977,5050,5555,11333,10781,8949,9574,11528,11013,9162,9892,3006,3562,3924,3816,2041,1919,3769,3986,5830,4975,6948,6856 ,7226,6978,5077,5601,6805,7197,5802,5078,3708,3548,3451,3940,10850,10897,10573,11305,9435,9111,10359,11338,9786,9625,10018,9696,9067,9827,9451,9054,12514,12837,13331,12826,10840,10579,10112,9867,6952,6923,7361,6761,6748,7685,6577,6864,12675,12596,12504,12704,12559,12567,14353,14346,11424,10458,9637,8950,12446,12625,12838,12960,3867,3789,3564,3035,6960,7245,6020,5023,7320,6980,5929,5735,3980,3511,3060,3891,10608,10892,9341,9140,9551,10008,11271,10470,6491,7041,7280,6387,3797,3047,3886,3325,5543,5842,7441,6806,5439,5775,7744,6598,9788,9863,9904,9169,13380,12406,12620,12867,12828,13360,12677,12461,13325,12409,12841,12487,6462,6819,5916,5857,3695,3973,3546,3790,10631,10553,9577,9115,9814,9164,10690,10782,9626,9503 ,11778,10574,13072,12467,12516,12626,9921,8953,9588,9069,11316,10473,10795,11014,5575,5371,5091,5836,3561,3928,3765,3064,7254,6762,5497,5984,4861,5052,7225,7042,10415,10363,11395,10898,9399,9667,10852,10581 ,6925,7458,5592,5957,7364,6520,4983,5533,9641,10004,9144,9878,11017,10460,8687,9454,4001,3885,3915,3679,5081,5816,6572,7690,5093,5726,5909,5558,6809,6880,6711,7251,3517,3795,2815,3952,7336,7222,5494,5741,10554,11345,9836,9811,10664,11308,9533,9621,6984,6769,6382,7303,6503,6601,6543,6931,5944,5783,6735,6822,3772,3572,3037,3454,5343,5812,6578,6821,7434,7686,6032,5082,10635,10913,10017,8895,14354,14464,12600,13824,9563,9830,9759,9928,12992,13442,14348,14369,3802,3870,2042,2039,5579,5747,5841,5039,10823,10595,9127,9877,9170,9817,11536,11334,12678,12462,12842,12869,9075,8954,9438,8695,6493,7444,5955,5604,7246,6389,7332,6602,13334,12681,12571,12410,10527,10423,9650,9117,12736,12641,12849,13384,12491,12351,12628,12682,3883,3547,3992,3911,3938,3515,3051,3570,9586,9461,10474,11291,13337,13569,12815,12870,9070,9670,8927,9991,12844,12469,12583,13347,5930,5550,6810,7257,6764,7697,4987,5937,10365,10797,11456,10900,10856,10582,9870,10052,10556,11397,10481,11018,10803,11314,9635,9829,12573,12520,14401,14356,10585,10692,9673,9565 ,5094,5691,7307,7457,5374,4862,5561,5805,10637,10643,11352,10447,9891,9447,9185,9783,3811,3743,3898,3038,6507,6271,5860,5742,10020,9644,11780,10914,9077,9131,9186,9592,3053,3985,3770,3893,7211,6335,7269,6926,10798,11025,11340,10672,12412,12493,12470,12931,6551,6580,5833,4607,6770,7362,5581,5500,9936,9848,11279,10597,13444,12850,14592,14370,10427,11402,9172,9881,9118,8956,10476,10904,6715,6609,5789,5962,6825,6390,6851,7490,9462,9133,9820,9559,9997,9649,11552,10864,6048,5587,5084,5753,3543,3703,3813,4004,5848,5903,6494,7228,6743,6812,7692,6934,5495,5940,7309,7464,6604,7267,5097,5047,5750,6022,7344,6393,3535,3798,3917,3569,12574,12873,12587,12642,10827,11020,11320,11362,13333,12499,12689,13392,10113,9775,10945,10366,6826,7808,5803,5487,2044,2043,3007,3944,9579,9834,10482,11303,9159,9459,10805,10638,6717,7315,6555,6947,5098,5564,7260,6933,12473,13349,12684,12632,9676,9642,10586,10696,12874,12933,13570,12881,9078,9023,9875,9534,7448,6853,6509,6584,5932,5590,5969,5367,12823,12528,13338,12494,10003,9139,10598,10645,10543,10809,11784,10484,9897,9623,11398,11337,6772,6833,5790,4989,3311,3988,3818,3925,10835,11523,8699,9453,10032,9081,10429,10806,12383,12615,12852,13088,9842,9176,9952,9682,6518,7368,6019,5557,6567,7700,5844,5811,14360,14372,12690,12644,10916,11409,11294,11348,6610,6937,5071,5958,3557,3759,3804,3894,9807,8943,10601,10946,10829,11584,10455,11026,4990,5911,727

4,6394,6515,7318,5593,5749,14343,14465,12595,12589,9894,9134,10050,9615,10887,10588,9652,9575,12705,13448,12501,13354,10659,10646,9188,9884,9833,10006,9163,9669,10704,10920,9465,9704,9925,9082,9790,9566,3059,4008,3832,3918,6625,6718,7492,6557,12856,13408,13120,12876,11041,11309,10602,11404,3710,3061,4033,3801,7253,6747,6510,7689,5606,5858,7431,7199,6612,7714,5938,5471,8701,9998,10830,10649,13323,13825,12474,12934,6799,7044,6949,6759,3975,3576,3897,3930,11526,10810,10114,9841,12692,13379,12515,13184,7310,6828,5799,5105,2031,1983,3814,3559,11361,11028,11792,11346,9141,9165,10837,11315,7553,6854,5562,5970,7331,6573,5051,5835,10812,11426,9589,9681,12882,12706,12590,12937,6938,6396,7258,6517,6749,7376,6992,6834,5582,6026,6857,6776,5985,5100,5754,5917,10459,10551,10948,10838,14402,14848,13059,12648,5814,6025,7460,6626,6950,7276,5695,5603,7227,6571,5872,5501,7321,7048,7713,6558,12827,12399,13340,12619,11529,10841,9900,9819,4002,3767,3825,2943,5831,5927,7435,6367,7270,7698,5589,5106,3487,3054,3926,3939,10891,10661,9192,9882,11032,11042,9084,9466,13456,12502,14347,14376,10851,11287,9630,10009,3987,3709,3550,4034,6807,6836,6979,7472,10842,11412,10650,10471,12597,13350,13572,12476,6080,5551,6763,6616,3900,3982,2046,2047,9582,9656,10928,10893,10060,9142,9343,9923,12737,13361,12505,12696,9698,10019,9789,9055,11368,10488,11310,10609,12897,12884,12839,12938,9643,8951,10430,10604,10056 ,9906,11808,10894,11335,10899,9893,9587,12517,12447,12708,12598,5053,5961,7281,6599,3771,3820,3563,3945 ,13381,12829,14404,14466,11401,10575,10720,10555,6940,7333,7745,6953,6858,7392,6865,6981,9995,9200,10461,10610,11525,10853,9815,9674,13576,13061,12898,12945,11648,10662,9468,8702,6860,7230,5079,5806,7446,7496,5054,5610,12621,13353,12407,13386,10665,10691,9627,9844,7008,6954,7317,6750,5972,5864,7338,7056,12888,12627,13472,12506,11317,10854,10783,11538,10475,10652,10583,10612,9171,9684,11425,11015,5817,6034,7247,6866,6840,6521,5756,5596,5499,5988,7568,6579,5915,5837,5612,5083,3062,3518,3791,3979,7437,7704,6028,5559,12656,12940,13319,12518,9145,10120,10021,9581,6961,7273,7936,6463,5108,5939,6765,7324,3065,4016,3929,3942,3817,3565,3826,3989,12679,12601,12738,12830,10557,11779,9930,8955,10462,11339,10064,9166,13826,12622,14355,14349,5845,5095,6956,6628,7489,6574,7716,7282,14384,14350,13364,12521,10666,10693,9645,9835,3871,3707,4040,3923,7443,6982,6811,7363,3803,3549,3066,3948,5934,5373,6632,7255,10477,11364,9905,10010,12843,13062,12463,12411,3773,3039,3981,3887,6383,6522,6603,6766,7554,6771,5743,6021,6581,6524,5594,5838 ,9407,9594,10799,11410,9821,9712,10022,9883,11532,11073,9146,9651,13443,12946,14408,14593,12900,12629,13065,12508,12602,13393,12712,13356,7345,7752,6962,7322,5609,5976,5813,5112,9926,9071,11044,10952,11322,11074,9173,9697,10901,11293,9898,9174,12683,12961,12871,12643,11048,11019,11457,10857,10844,11781,10673,10960,11056,11341,10116,9119,11416,11076,10025,9831,6049,5933,7438,6605,5963,5727,7687,6640,10587,11137,11376,10483,9639,9938,11537,10902,6813,7334,5565,5843,7461,6823,4863,6000,9535,9871,11840,10694,10558,10915,10012,9953,13584,13382,12575,12471,12522,13339,14357,14468,5820,5620,7284,7223,3573,4003,4036,3932,5085,5502,5850,5918,7365,6868,6985,7449,6773,7728,6495,6611,3774,3996,3828,3566,9671,9467,9187,9932,12413,12845,13504,12948,7504,6582,7259,6881,6395,6606,6586,6585,12904,12630,14371,14594,11350,10858,9593,10080,12604,13445,12529,13066,8957,9148,11321,11138,5931,5595,7810,6613,7693,6391,6827,7340,11021,11554,9688,10053,12851,13362,12633,12740,11460,10616,9079,9629,12685,12691,13400,12495,3068,3815,3953,3899,6040,5959,5986,5563,3941,3993,3805,3578,5099,5618,7370,6986,14362,14849,13828,12962,12846,13073,13388,12720,7556,7271,6882,7288,4006,3519,3055,4048,5859,5791,7452,7043,7746,6814,5946,5086,9177,9912,10668,11786,9189,9822,10005,9654,5101,6033,7462,6927,7229,6993,5818,5941,13327,12645,12475,13450,10905,10976,10807,11347,12524,12952,13600,12912,11432,11318,9590,9837,11080,10865,10478,11399,10599,10697,10639,11027,7699,7337,5591,5751,3895,3946,3571,3990,10040,9879,10831,10918,12875,13068,13368,13410,6964,7720,68 72,7072,6935,6511,5861,6052,9439,9908,10674,10917,11530,11782,10128,9178,7520,7045,5583,5846,7377,6774,
5965,5617,9675,9843,9937,9135,10589,11540,10051,9700,11342,10485,11428,10698,14416,14373,12993,12414,7465,6829,6988,7348,6777,6855,5055,5992,4009,3919,3819,3577,5359,6036,7262,6397,6835,7445,6968,7319,5866,
5973,7046,6830,10026,9646,10906,11353,12530,13351,14361,14358,10860,11793,9083,10033,9190,9787,11403,11553,12853,12686,12634,12744,9470,8958,9657,9901,7812,7366,5605,5807,7560,7277,6884,7491,14472,14596,12646,12693,12591,12857,13832,12532,10603,10367,9956,9838,13446,13385,12883,13571,3960,3806,4037,3994,3574,3954,3931,3821,5852,5942,6994,6519,7702,6588,5107,6056,12477,12854,12964,13457,11307,10431,11365,11022,10647,10676,9929,8703,13342,13396,12649,12994,7450,6614,7311,6627,7691,6559,5880,5966,10866,11458,9677,9596,12877,13632,12503,13074,10811,10705,9885,10058,10921,10486,10947,11586,4005,3901,4024,3063,5758,5109,6629,7049,12935,12636,14600,14374,10144,9683,9180,9849,12707,12694,14850,14432,9944,9999,10590,11324,10839,10908,11788,11030,9591,10036,11405,11560,6081,5849,7346,6939,6617,7384,6778,6888,6023,5624,7760,6996,5945,5978,7104,7466,10700,11363,9193,9143,9846,10118,11440,10489,7009,6837,5862,5607,3799,4041 ,3551,4010,10922,11904,9899,9583,12752,12968,14403,14377,7275,7938,7494,6941,7369,7748,7715,7050,10813,
11411,10651,11043,13089,13357,12650,13452,6050,5815,7396,6859,7285,7474,5873,4991,9194,9660,11356,11029,11544,10949,10605,10680,3829,3933,3956,4064,6951,6618,6780,7323,2015,2045,3902,3580,6838,6398,5535,5102,14480,14364,12878,12697,10028,9686,10065,9463,10868,10929,9886,9085,13574,12858,13409,13076,7694,7809,5974,5987,6861,7215,7459,6719,10614,11464,10115,9653,10663,11796,9940,9907,13840,13394,12885,13363,10706,11033,9167,10054,12860,13474,12507,12599,9086,10007,11370,10490,10611,11414,9689,9845,12996,12886 ,13577,12889,7057,7584,6942,6955,6523,7352,6035,5757,12939,12709,13080,13090,14405,14378,12899,13335,10721,10814,11588,10653,12890,13460,12698,12519,7497,7335,5598,6082,6841,7708,5948,6030,11349,10843,1060
6,11785,9702,9954,11527,11295,10708,11810,10034,9567,10895,11140,11045,10855,12976,12941,14852,14385,11406,10924,9895,9201,6575,7286,6751,7372,4020,3822,3067,3943,13416,12536,13358,12657,11649,10950,9658,10066,6633,7468,5819,5868,7010,6867,5611,5993,14410,14608,12478,12652,11427,10669,9147,9931,4035,4017,3830,3327,6630,7717,7325,7378,11034,10492,11354,10613,10845,11472,11088,10930,13856,12942,13383,12947,9678,10122,10953,10872,10081,9196,9850,10013,13449,12623,12768,12603,9910,10121,11556,10722,11046,11372,9791,9699,7052,7937,7705,6862,5110,5566,6957,7508,11323,10667,9968,9597,11417,11144,11809,10654,5839,6027,6620,7000,3991,3947,4042,3711,7261,7555,6983,7473,7439,7290,6869,6842,7616,7058,5113,6064,7393,6896,7012,6963,12509,12658,13573,12901,9927,10023,11531,10463,11366,11794,9685,9202,13696,12710,14496,15362,7493,6958,6583,7073,5977,5990,7341,7722,12713,12739,14856,14624,10903,10932,11075,11568,5865,5613,6634,7283,5874,6037,5919,5755,13365,12902,12831,13586,10176,9647,10859,10712,12523,12700,12631,12660,9149,10057,11377,10695,7824,6767,6088,5971,7776,7480,5851,5597,14864,14528,13473,13063,11036,11429,11841,11049,12605,13827,12510,13387,12714,12741,12525,13412,6815,7342,7506,6883,4012,3833,3069,3983,10954,11488,10961,11077,10956,11326,9175,9902,11542,11592,9150,9706,12847,13458,14880,14406,5114,5996,7747,7701,5821,5087,7557,7060,11104,11050,11413,10846,10068,9960,11434,11152,3934,4049,3455,3827,7447,6607,7380,6987,
13580,13121,13092,13000,9913,10130,11343,10962,10936,10617,9852,9692,13370,13122,12949,13341,14380,14467,14417,14386,9595,10084,11664,10675,10011,9933,9708,9179,13096,13067,13505,12905,11533,11800,10124,9655,11057,11369,12032,10559,9204,10035,10861,11420,12892,13829,12721,13008,4038,4018,3927,3070,7279,6525,7816,7498,13104,13389,14409,14351,13464,13124,12635,13185,3950,3995,3807,3955,6641,7730,7074,6965,9941,9191,11052,10724,11585,10670,11812,11378,13424,12531,13585,12950,11539,11078,10907,11459,6870,7105,7347,7326,6029,5935,7016,7562,13888,12742,12606,1

2963,10030,9469,10728,11351,6636,7394,7476,6775,
5621,60
51,6084,5980,14656,14469,13398,12906,10479,1061
8,10699,10862,11650,10867,9839,10117,10677,1062
0,9690,9
934,5822,6044,7718,7367,6873,7289,7749,6844,5876
,5614,7940,6587,5116,5863,6001,5947,13369,13186,
13069,1
3602,11441,11848,11058,11418,7451,6885,5989,604
1,7522,7706,7500,7349,6989,7463,7064,6526,3575,4
044,3834 ,4007,13508,12664,12716,13834,14388,143
59,12953,13024,7729,6966,7569,6995,7373,6874,775
3,6642,9705,1007
2,9909,9208,12855,13395,14470,14720,13480,13366,
14412,14473,10145,10029,11534,10701,4050,3961,3
997,406
5,5853,5626,7024,7400,10059,9823,11783,10736,131
28,12913,12526,13447,6886,6589,7536,6615,3582,38
36,3958 ,4013,10909,11430,9661,9939,11557,10919,
8959,10096,12647,12745,12687,13075,9916,9716,11
380,11319,14418,
14392,12879,12966,12722,12965,13578,13830,14363
,14433,12637, 13588,9181,9598,9946, 100 14, 11461,
10964, 110
81,11545,13390,12533,13476,12746,6054,5567,5103,
6096,6779,7292,7840,7076,10869,11824,10591,1070
7,12954,
13401,12908,13841,11600,10678,11355,10977,10491
,10702,10682,10681,10027,9691,11906,10709,11789,
10487,1
0923,11436,13451,13601,12651,12415,10136,10055,
10082,9659,7724,6831,5943,5994,7354,7564,7756,74
69,9195,
9714,11466,11082,11652,11367,10978,11384,5619,6
038,7944,7047,7278,6969,6057,5967,13355,12479,13
413,130
70,12695,12724,14375,14595,9955,9887,11548,1113
9,12914,13506,14420,14474,7379,7505,5867,5625,66
44,7721,
6990,7814,7339,6889,6008,5854,4052,3949,4014,382
3,6970,6876,6085,6042,7408,6590,7106,7570,12859,
12753,1
4481,14597,11842,10910,10042,9182,7764,7080,752
1,6619,5622,6002,6997,7454,12969,12534,12995,136
34,9197,
10129,11558,11023,11325,11089,9914,10037,14365,
14379,14434,14851,7011,6781,7695,7374,5979,5869,
7558,70
51,12638,13372,12887,12956,11795,11433,9687,984
7,4056,3579,4019,3998,7350,7811,7732,7477,6631,7
952,6053 ,5949,6839,7585,7231,6890,13836,13078,1
4424,14476,13453,13608,12748,13411,3957,4039,40
66,3775,6072,5111 ,6972,6897,7754,6998,7381,7470,
5847,6089,5599,6058,13488,12537,12970,13952,110
60,11816,10968,11168,1103
1,10607,9957,10148,12861,13459,12699,13091,1161
6,11141,9679,9942,13404,13077,13592,12997,11473,
10870,1
0061,9713,11561,10925,11084,11444,12653,12728,1
2916,12977,10873,10951,9151,10088,14366,14482,1
2662,135
12,9455,10132,11358,10493,10931,11541,11064,114
15,9962,10069,11142,10926,11908,11462,9701,9903,
11656,11
373,10980,11587,7001,7512,7353,6648,6943,7499,63
99,7108,15364,14407,12711,13844,9948,10038,1109
0,10615,
12754,13081,14598,14601,11798,10684,9203,10152,
11546,10710,11407,10723,14497,14912,13418,12538
,5877,59
81,7386,7053,6004,6112,7817,7703,7453,6863,7287,
6621,7761,7059,7592,7524,3964,3903,4022,4043,678
2,6892,5
950,5628,12659,13462,14381,14436,11787,10655,99
76,10062,12769,12862,13636,12701,13397,12891,12
654,1383
3,9854,9205,10725,11145,13575,13343,12756,13858,
7088,7872,7475,7371,7013,7736,7572,6635,12943,13
188,130
93,12903,10177,9945,11442,11035,13454,12972,136
97,12998,10713,11480,10874,10984,6843,7397,6068,
5870,40
68,4025,3835,3962,4053,3935,3071,4011,7495,6898,
5115,5991,14976,15361,13475,12717,10119,9720,11
856,1109
2,14387,14484,13082,12540,10041,10074,11200,115
62,7327,7709,7002,7762,7561,7620,6622,7112,13402
,12661,1
2893,13520,13136,12978,14382,14411,7404,6527,60
83,6065,7356,7054,7945,6959,11105,10933,9958,970
3,13001,
12920,14602,14609,11371,12034,11590,11037,11465
,11844,11811,11146,10146,9911,11492,10955,11381,
11570,99
69,9087,7723,7120,5878,5375,7014,7828,7777,7061,
13604,12770,13094,13420,11047,10714,10876,11419
,6039,59
95,7481,7385,6090,5759,7750,7968,14853,14440,133
71,12715,10934,10494,9631,9198,6871,7294,7586,66
37,7501 ,7395,6060,5881,13465,13192,13857,12702,
11790,11905,10070,10083,10957,11311,11555,10815
,14498,14389,13
579,12511,11153,11680,11038,11051,10619,11448,1
0131,9853,4046,3831,4072,4028,7820,7017,5117,603
1,7528,6
845,7710,7075,7467,7942,7509,7617,13414,13842,12
951,12980,11593,11431,9694,10178,10937,11804,10
044,101
26,13123,13616,12907,12760,10671,11382,10847,11
468,14529,15368,13425,12743,6900,7478,7004,6643,
6875,77
92,7382,6967,10729,11564,9915,9964,11106,10963,9
707,10089,14488,14413,13084,13477,13889,13097,1
3002,13
536,7719,7066,7343,7818,5982,6097,7018,7576,1300
9,13125,13004,13374,14500,15104,13590,13640,107

26,1181
3,11421,11474,13152,13098,13461,12894,7565,7062,5503,5875,6086,6066,7780,7398,11148,12033,11801,10958,9
206,9662,11053,11604,13482,13200,13391,13010,9935,10123,10716,11096,3951,4021,4051,3837,6646,7939,5975,
5118,12984,12665,14604,14610,11357,11651,11079,11569,13712,12723,14854,14390,11535,11386,10965,10938,1
3581,13848,13105,13417,11712,11154,9209,10160,7077,7510,5998,6043,7482,7826,7731,7355,7632,6887,7502,69
04,4045,4080,4026,3965,11489,10992,11108,11059,11589,11054,10679,11169,7388,7725,7025,7291,6638,7523,74
16,6846,14080,12607,12909,13468,10073,10086,11437,11818,9961,9709,10730,11379,14419,14393,14857,14448,
9970,10133,10015,9851,11920,10863,10184,10067,7065,7768,6645,7020,5855,6003,7559,6991,13100,12772,1363
3,12718,11872,11576,9947,9693,8000,7588,7136,7841,5623,6092,5882,6055,10911,11438,11602,10979,13860,134
26,15360,14471,9210,10092,11843,11797,9917,9183,11653,11156,6591,7751,7580,7513,6098,6009,7401,7848,135
87,13126,12955,13507,14414,14625,12776,13399,12527,12666,12747,12910,11543,10703,11476,11083,13698,129
15,14530,14421,12725,12668,13489,13896,13106,13466,14612,14858,11375,10621,11912,11594,6045,6113,6877,
7941,5630,5884,7813,7484,13582,12749,13831,12784,10737,11826,11170,11061,12957,13478,13605,12967,14394 ,14504,13428,13367,7375,6971,7734,7078,4058,3567,4067,4054,10966,11201,11443,11422,10125,10031,11112,11
658,10732,11490,11572,10871,14475,14435,13509,13012,9717,10147,10180,10076,9918,10140,11814,11463,7778 ,7618,7026,7081,3999,3959,4069,4057,13129,13593,12917,13872,14422,14396,12639,12755,7107,7563,6891,7409 ,7263,6649,7525,6999,10969,11385,11845,10940,14616,14425,13648,12726,13403,13025,14626,14865,9972,9710,
12036,10683,9212,9959,10097,10043,12539,12750,12730,12729,11547,10981,10085,10137,11618,11802,11596,11
445,11085,11559,11160,10622,14860,14532,13954,12757,7068,7954,6006,6061,6878,6973,7707,7357,13837,1253
5,12971,13484,14477,15376,14437,14483,7755,7507,6100,5997,7574,7402,7832,7530,11825,11062,11665,11091,1
3514,13130,13700,13415,7109,7758,7874,7383,6062,5871,7082,7028,11469,10970,11849,10738,13026,13432,145
12,14478,9949,9722,11120,11496,13596,13187,13890,12958,10982,10685,11632,10711,13606,13071,13373,13137 ,6104,5627,6650,7471,7733,7948,6067,6046,10150,9663,9199,10192,10875,11388,11936,11172,6893,7514,7784,7
089,7110,7600,7825,6899,11820,10927,10039,10090,13843,13481,13108,13864,13016,13216,13079,12655,14866,
14657,13664,13189,11450,11660,11852,11565,14367,14536,14426,15392,13521,12918,14881,14628,9715,10134,1
2040,11143,3838,4074,4023,4060,7410,7003,6005,6087,11374,11065,10153,10063,13609,12973,13132,13492,757
1,7737,7532,7084,7358,6974,7953,7055,11475,11601,9963,9721,10740,11817,11086,11910,12921,12999,14658,14
868,14599,14485,14438,14441,11435,10985,10104,9950,13406,12541,12979,13589,13112,13463,14640,14632,131
90,12974,13956,13510,11066,10972,10181,10138,11504,10686,11202,11666,13704,13421,13028,13635,11860,111
76,11617,10715,4015,3963,4073,4070,7765,7726,7976,7015,13138,12663,13846,12732,9718,10098,11093,11550,1
1107,10877,11791,11470,10075,9965,11654,11147,13594,12758,13455,12771,11446,11907,11828,11573,10727,12
048,10149,10045,10935,11681,11327,10986,6114,5823,6783,7624,7842,7479,7032,7516,13835,12703,15366,1449
9,12773,13193,14428,15369,7389,6623,7566,7412,6012,5951,6070,6091,10168,9207,11068,10993,13490,13083,12
761,13528,7090,7876,7821,6894,7946,7770,7537,7113,6116,6073,6652,7757,7005,7590,8001,7483,14383,14603,1
2922,13032,11850,11094,11477,11566,6901,7526,7114,7844,7387,7063,5883,6010,14721,14882,13904,13140,146
60,14544,14722,14486,7738,7577,7970,7648,7019,7779,7403,7006,9943,10185,9695,10154,13248,13610,14489,14
501,13153,12981,14442,14391,11097,11608,11449,10744,4029,3966,4081,4047,6101,5983,8064,7819,13419,1408
2,13638,13085,13513,13892,13859,13194,5119,6059,7589,6902,4076,3581,4059,4030,14664,15424,13540,13003,1
1039,11595,10495,11204,13429,13618,13095,12762,9973,10077,11482,11149,12924,13467,12982,12542,10100,10
208,11913,11799,13838,13953,14872,14913,11549,10959,11383,10717,13005,13359,14884,15370,13603,12863,13
201,13728,11857,11155,11688,11620,13086,13099,12667,13496,10878,10988,10046,9724,11184,11968,1

1571,114 67,11109,11832,11668,10731,10939,11493,10164,99 66,14449,14490,13641,13479,14415,14605,12985,13 852,7293 ,7092,7503,7960,7740,7815,7856,7121,115 91,10994,9211,10087,12719,13430,12895,13516,114 23,11805,11098,11 858,14444,14914,12777,13612,14560,14502,13154,1 3011,11657,11716,10718,11208,7529,7067,7766,711 6,7578,7 455,6094,5879,7873,6905,7540,7021,6120,6076,7351 ,7619,7593,7956,7096,7830,6639,7406,5999,6069,14 855,148 88,12774,13861,13469,13522,13196,14081,11500,10 623,10179,10161,13849,13006,13101,13652,14531,1 4606,127 64,13144,11452,11150,12041,11055,7788,7763,7485, 7573,7969,6847,7515,7782,15377,14977,13405,1369 9,11819, 11216,9974,9471,4082,4027,4071,4061,7711,7880,70 79,7829,7122,7769,7027,6906,7390,6647,7602,7069, 13127,1 3617,13583,13434,11110,11924,11873,11157,7538,7 413,6099,5885,7022,7622,6879,7943,15372,14859,13 013,1298 6,13760,13202,14611,14916,13537,13040,13156,131 07,13637,13102,12727,13217,10135,10091,11577,11 481,1462 7,14395,13485,13866,10186,9855,11846,12064,1096 7,11390,11682,10733,12778,13427,14505,14896,115 97,11491 ,10156,9977,13968,12911,14450,14613,119 16,11113,9213,10127,13920,13624,12959,13486,116 24,10941,11806,11 171,13650,13027,14492,14423,11563,12038,11605,1 1713,6093,6128,7822,8004,6074,6013,7587,7781,109 96,1157 4,11100,10739,13891,13845,15488,14533,10971,118 88,11478,11063,11815,11162,11439,11914,14452,14 506,1370 1,13204,10078,10193,11114,11672,6106,5615,7625,7 517,7843,7399,7137,7735,4084,4055,4078,4062,7972 ,7596,7 029,7083,11661,11158,9599,9971,13591,12751,1352 4,13131,14397,15378,13423,12669,10182,10162,118 76,11494 ,13960,13642,14867,14861,10742,12035,10 071,9214,7138,7544,7888,7800,7124,7833,7070,6908 ,12785,13874,132 18,13109,14978,14617,13014,13249,13491,13470,14 614,14862,13160,13706,12780,13538,7414,7085,777 2,7511,7 949,7601,6115,6102,13620,12919,14513,14629,1117 3,11606,10094,10139,14724,15393,13862,13511,115 78,11922, 11827,11451,8065,7727,7531,7786,6047,6007,7111,7 411,13017,13433,13893,12988,14427,14920,14084,1 2731,76 28,7594,6117,6105,7030,6975,7827,7486,11728,1098 3,11598,11000,15105,14534,13595,13029,11484,118 21,11121 ,11387,14508,14456,13666,13850,13644,13

493,13133,13607,10734,11619,11512,10942,7955,70 91,7849,7575,665 1,7405,7984,7033,11161,11864,10741,11116,9951,10 099,11655,11087,7794,7128,7904,7634,7759,6895,58 86,6122, 14537,14672,13208,12670,12096,11684,11232,11937 ,9719,10188,9978,10151,14398,14618,13873,13110,1 3713,13 139,14479,15365,10687,11847,11676,11609,15380,1 4439,13517,13018,10194,10105,11497,11944,7846,7 086,8002 ,7567,7604,7527,7140,7836,10141,10209,1 0973,12037,13897,12786,14514,14630,9726,9980,11 909,11580,11471,1 1067,11830,11174,13168,13544,13030,12733,13680, 12759,14429,15394,7785,7958,7115,7621,6071,6108, 7417,76 56,14980,14538,14928,14659,11874,11714,11122,11 177,12923,13436,13984,13220,13868,12975,14728,1 4633,134 98,13708,13900,13613,14088,13191,13422,13113,11 203,11659,10987,11505,13523,13649,12788,13865,7 877,7034 ,7742,7518,6063,6011,6653,7950,11359,10 745,11621,11095,13134,13958,13483,13033,15106,1 4443,14516,15616, 11164,12050,10102,10157,8066,7793,7093,7117,408 8,3583,4075,4077,10974,11069,11803,11453,11851,1 1603,101 96,10093,13114,13020,14487,14545,11670,11498,11 928,11626,14620,15363,13552,12734,14984,14430,1 3250,137 14,7541,7633,7852,7771,7144,7834,7036,7418,7582, 7961,7534,7608,6121,6118,8012,7094,11205,11854,1 1970,11 479,13908,13224,14540,14634,13665,12763,14736,1 4944,10158,9967,11178,11124,10200,9723,10746,11 567,1542 5,14688,14661,14869,11829,12044,10163,10142,109 89,11610,11880,11185,7295,7875,7650,7971,7741,70 07,6077, 6014,13141,13598,13155,12925,11206,11696,11921, 10995,6129,6095,7595,6903,8008,7858,7845,7539,14 491,145 46,13839,13518,14641,14883,13702,13195,13494,13 955,13876,13621,11506,11099,10101,10183,12775,1 4096,146 36,14445,11667,11833,11628,11180,12983,13729,13 375,13034,11454,11070,12049,11151,13116,13041,1 3898,131 42,13525,13614,15384,14520,11861,11822,12072,11 111,10210,9919,10879,11720,7947,7152,7767,7626,7 420,6654 ,7579,7796,11938,11575,11128,11612,1314 5,13656,14870,15396,13497,12792,13087,13643,148 73,14451,12543,1 3252,11485,10719,11662,11508,15426,14503,14561, 14662,13530,13197,14642,15108,10108,10047,10166 ,10187,1 1186,11972,11917,10990,14493,14992,13961,13847, 7123,7636,7097,8072,7973,7533,7882,6907,13597,13

007,146
65,14446,12042,11866,11633,11209,4083,4085,3839,
4086,6124,5629,8016,7118,13431,12765,14453,1454
8,13905,
13203,13736,13668,10212,10169,10748,11853,14507
,15374,12926,13036,15112,15400,13232,14016,1361
9,13515,
13157,13880,11101,11686,12097,11579,10997,11622
,11210,11940,13716,12779,12987,13541,11483,1115
9,9979,1
0106,7597,7787,7857,7962,7359,7546,7773,7664,136
39,13042,14666,15489,11834,11673,12066,11744,13
471,138
53,14562,14885,11115,11875,11499,11102,13146,13
906,13705,13764,10197,10079,12160,11915,7974,78
35,7098,7
603,7878,7023,7125,7649,9215,10155,11685,10998,1
5379,14874,12766,13256,13548,12671,14723,14644,
11389,1
1188,11599,12056,6107,6078,7850,7126,8068,7071,7
977,7783,13500,13198,14089,13103,14552,14752,13
867,132
64,7591,7890,6130,6075,7487,7823,7964,7905,14607
,14615,13158,13972,13921,13205,14494,14673,1183
6,11911,
11952,11217,14886,15008,15428,14454,13625,13529
,14668,14915,11625,11163,11862,11212,13894,1411
2,13015,
13438,13730,12781,13645,13539,7623,7419,7139,78
84,7545,8032,6909,7100,14876,15408,13964,13161,1
1674,11
551,10190,9975,4089,3967,4090,4087,7640,8005,703
1,7581,14725,14509,13672,12989,11969,11001,1163
6,11117,
15373,14457,13854,13219,10216,10172,11447,11715
,13611,14086,13653,13761,14889,14535,13044,1362
2,13148,
12787,15120,14515,13019,13936,13526,13111,11689
,12052,11192,11926,13863,13210,13487,13962,1073
5,11502,
10095,10165,11884,11859,11581,11669,12065,10943
,11611,11878,14564,14674,13162,13720,13709,1320
6,14648,
15872,11807,11976,11175,11925,15040,15490,13924
,13542,11218,11865,11123,11002,14726,14510,1279
0,14083,
14890,14917,13221,13654,7129,7864,7141,7774,795
7,7606,6119,6109,11486,10743,11698,11165,15382,1
4729,13
626,13970,14619,14458,14784,14689,11634,11509,1
0195,9981,7542,7789,6132,6103,7992,7831,7391,786
0,8080,7
130,7627,7795,7889,7087,8003,7652,13875,13499,13
776,13031,13646,13048,14897,15432,11118,11718,1
0975,12
039,13532,13869,13169,13435,7978,7598,7035,7985,
4092,4091,4079,4031,10189,10224,11918,12100,145
39,1439
9,12782,13667,7142,7739,7422,6910,7609,7853,7908
,7790,13560,12990,14676,14730,15385,15617,13209,
13912,1
2789,13164,14863,14918,13703,13135,14144,13732,
13280,13985,14892,14517,10170,10109,11683,11877
,14631,1
5395,14621,14568,10202,9711,11721,11613,12735,1
3895,13724,13657,14460,14541,13545,13992,11939,
11495,11
233,11831,14518,14979,13021,14085,12068,11692,1
1125,11179,15492,14898,13957,13628,13519,13115,
13878,13
222,11234,11640,11984,11896,11220,11929,11166,1
1004,14622,14921,13922,13762,11510,11181,11868,
11607,120
45,11697,10211,10198,6126,6110,7881,6655,7629,75
48,7837,8010,14635,14690,15381,14547,12161,1182
3,11627,
11882,13170,13225,14737,15440,14521,15397,13251
,13707,10143,10103,11207,11507,13035,13553,1473
2,14680,
6136,5631,8096,7635,7132,7801,7896,7951,7543,798
8,7145,7095,7798,8070,7851,7535,11724,11690,1021
3,10201 ,13407,12793,13669,13143,14922,14981,132
12,14098,15618,14929,14871,14576,7146,7612,7980,
7638,8017,7415,
7838,7037,15386,14542,13022,13117,13851,13501,1
4431,14663,8067,7605,7892,7859,6123,6125,7119,80
06,1112
6,11071,11923,11582,13899,13651,14900,15136,703
8,7959,6131,6133,7641,7797,7654,7906,13718,13546
,13976,1
3674,13253,13902,14018,13527,14738,14692,13226,
13172,12051,11187,11945,11671,12794,13615,13877
,14092,1
0747,11501,12080,11129,14643,14637,14753,15496,
13037,13658,14549,15402,11890,11224,12000,11730
,11855,1
0991,9982,10218,11942,11182,12098,11663,14904,1
5456,13928,13233,11700,11623,11236,11932,15168,
14924,13
254,13744,13969,13043,15371,15873,11881,12054,1
1211,11717,14522,14982,13554,13147,10167,10204,
11513,11
752,11973,11130,11838,11614,14740,15427,14563,1
5232,7986,7519,7847,7153,7610,8018,7099,7883,101
59,1010
7,10749,12046,12162,11889,11189,11213,14930,147
54,13715,13881,13676,13228,14638,14985,13502,13
118,1510
7,14696,14097,13199,13909,13870,7630,8074,8033,7
148,7802,7965,7862,8073,14875,14447,14120,13159,
15388,1
4667,12927,13768,13986,13623,13176,13660,13533,
12767,13710,13556,11637,11729,11948,11867,15504
,14550,1
3234,14020,14645,15398,13965,13038,14090,13914,
15620,14524,5887,6134,7743,7651,7920,7549,7879,7

975,112 40,11930,11132,11514,11678,12057,11630,11704,7637,7154,8128,7599,7101,8009,7127,7854,10217,10214,12108, 11190,14785,15409,13681,13257,14553,14744,14945,14932,12796,13901,14887,14986,7102,7658,8020,7912,6137 ,6015,7865,8082,11391,11971,11746,12067, 14565,14495,13149,13734,14756,14646,14145,13627,11837,11103,10 173,10110,10225,10191,11691,10999,15429,14877,13045,13670,15624,15109,13258,13988,12104,11954, 11941,11 635,14946,14993,14669,15401,12043,11248,11863,11722,7804,7644,7547,8036,7963,7885,7660,7131,13531,1320 7,14455,15434,13882,13721,14114,13792,13163,13923,13547,13150,11516,10750,11675,11892,14936,14675,1420 8,13963,11219,11732,11193,12168,15520,14554,13733,13046,12069,11629,11978,11003,14704,14988,13437,1323 6,13647,14104,15367,14566,13884,13959,14000,13265,10220,9725,12112,11214,8076,7607,7156,7987,7893,7143, 7982,7421,11693,11883,11953,12058,14727,14649,13673,13211,13910,13260,14786,14878,13722,13599, 15874,14 670,11455,11642,11869,11760,14017,13049,13684,13165,15412,14569,14891,15110,12070,11931,11194, 11699,14 511,14459,15491,14994,13495,13763,14948,14677,7791,8069,7642,7886,7657,8024,7861,7160,8097,7981,8011,77 75,7613,7891,6911,8048,11974,11119,11221,11745,13737,14100,13240,13974,15113,14556,12783,13550, 10203,10 174,11946,11222,14650,15441,13932,13907,14760,15404,13629,13717,14731,15009,14113,12991,12164, 11167,12 073,11879,7868,7668,7133,7550,7898,7966,6138,6135,11687,11986,10226,10171,13659,13926,13855,14024,1158 3,11919,12060,12001,14919,14691,13223,13973,13266,13913,15632,15430,13171,13050,13534,12791,11719,1151 5,11235,11980,14623,14519,13746,13213,11641,12128,11005,11196,13682,13557,14570,15387,13166,13766,1302 3,14087,11736,12101,11127,11677,7979,7643,8088,8007,8034,7611,7147,7666,14461,14893,15552,14996, 14952,1 4678,13966,14148,14652,15493,14577,15114,14899, 15410,13731,13925,11225,11960,11237,11870,14681,14788,1 3769,13661,14733,14739,15448,14543,12053,11702, 10215,10205,7907,7839,7994,7134,7149,8081,7866,7989,139 87,13543,13281,13879,14116,13740,15876,15010,40 94,4095,4063,4093,7639,7799,7909,8100,13173,13227,13282, 13688,11638,11885,10228,10199,14894,15121,15436,14768,12088,11927,11487,11956,14032,13944,15375,14693, 14523,15498,13268,13977,13214,13052,14572,15000,13558,13229,13916,13655,14093,13745,15648,14960,12176, 11226,11723,11891,14923,15116,15416,15458,11985,11183,12099,11748,14209,13871,15041,14462,12074,11694, 11131,12081,13675,13930,14578,15399,13255,13555,14901,14734,7631,7894,8013,7665,6140,6139,7103, 8040,13 772,13738,14682,14792,11238,11835,11518,11006,13174,13119,13971,13630,11705,11949,12004,11886, 7407,808 4,7914,8021,7653,7855,7900,7990,14099,13235,14694,14741,14639,14905,15880,14580,13993,13719,15494,1543 3,14931,15619,12795,13549,10222,10206,11977,10751,14128,13177,14525,14902,11725,11644,11933,12106,1393 8,13272,14048,13778,7155,8104,7928,8014,7806,7157,8129,7897,15012,15505,15390,15444,13903,13039, 14697,1 5042,14925,15680,14551,15122,13990,13230,14146, 13711,14983,14684,13748,13671,10232,9727,12192, 11731,14 755,14742,13284,13980,13929,14102,13259,13765,14800,15016,13561,13800,14021,13178,13886,13662, 11228,11 897,11992,12047,15137,15405,14698,15500,11639,12084,11241,11191,12797,14094,14926,14745,11894, 12166,11 947,11631,11242,11708,12076,11734,15622,14906,14210,13937,12113,11511,11934,11133,15457,15124, 15888,15 442,12163,11701,11988,11955,13237,13261,14933,15411,14908,15522,13685,13777,8071,7672,7993,8026,6127,6 079,7910,7655,10219,10221,11215,12102,14555,14647,15044,14934,11134,12055,10227,10229,15625,14937,1399 6,13915,8098,7863,7921,7039,7583,7150,8022,8035, 14987,14757,13288,13978,15128,15138,13180,13562,8083,78 05,7646,8130,7996,8078,6142,6143,14947,15383,13726,14105,14938,15508,14746,14567,7867,7916,7659, 8041,71 58,7614,7887,8075,13678,13752,15024,14989,14156, 13238,13439,14019,13794,14115,13885,13151,15464,14584, 15406,14705,11737,11893,11750,12002,13739,13047,14526,14700,14152,14002,15904,14990,15431,14995,13989, 13683,12082,11615,11943,11249,11706,12114,11195,11979,11726,12170,12129,11244,15497,14671,1481

6,14651,
14091,13296,14557,14706,15621,14949,13911,13770,11898,12061,11958,12169,15744,14758,13564,12798,9983,1
0230,11839,11747,12016,11645,11975,12071,14761,14787,13723,13940,11733,11250,12224,11695,15413,14950,1
4879,15634,14571,14748,14679,14708,13267,13780,15521,15111,13241,14216,14117,13677,7161,8112,8025,8038 ,7913,7661,7922,8085,14653,15875,14026,13051,14558,15435,14160,13262,14762,14789,13741,13931,14573,154
60,14001,14106,7967,7803,8136,8019,7899,7645,7162,8044,11197,12105,11223,11950,13503,13690,14895,15506,
13917,13808,14118,13979,15628,15169,13242,13747,7869,7135,8077,7983,7669,8099,8132,8028,11198,11754,12
116,12008,10233,10111,11961,12178,14022,13167,15140,15048,15418,15170,13269,13793,14997,15389,13994,13
270,11900,11740,11643,12132,15144,15115,15553,14953,14940,15877,14769,15056,12059,11981,11756,11227,15
152,15437,14212,13215,15512,15172,14121,13927,12172,11703,11252,12083,14683,15233,15472,14579,11989,11
239,12078,11517,13735,14034,15633,14998,13631,13967,15936,14790,14654,15011,14108,14049,11887,12165,11
738,11982,7870,8092,7924,7662,7164,7911,8049,7995,13767,13563,13283,14028,11753,12120,11957,11256,1544
6,14954,13689,14176,13053,13244,15417,15234,15117,15650,13784,14149,15556,14712,13175,13725,12193,1207 7,12107,11871,13273,14008,14764,15882,13285,13918,14101, 13750,15001,15072,14903,15443,11709,11987, 1100
7,12144,15528,15414,13686,13933,8037,8089,7901,7674,8102,7615,7151,8144,15176,14961,14574,15495,14695,1
4793,14735,15123,14136,13975,14927,15014,11964,11764,11229,11646,13535,14004,14770,15013,15626,15878,1
4224,13274,7991,8042,7667,8086,8105,8015,7915,7673,11994,12062,10234,10231,13771,13939,14033,13231,146
85,15636,14147,13796,15438,14581,15524,14794,12075,11739,12184,12103,12130,11707,11243,11762,14122,137
42,15002,15449,14956,15889,13179,14129,13286,13883,15499,15649,13566,13054,13753,13997,12003,11935,120
90,11230,14699,14463,14052,13934,11245,12177,11962,12085,15403,14527,15461,15118,14743,14772,14025,127
99,14962,15554,13773,13692,14907,14801,13981,14154,15017,14582,15043,15682,8056,7902,8133,8090,7670,80
50,8027,7917,14240,13779,13276,13945,11735,11895,12005,12196,14040,14095,14686,15420,14935,15004,15884 ,15126,13687,14132,15501,15656,14796,15459,13289,13239,13942,14214,15536,14585,11727,11990,12109,11761 ,8101,7997,8120,7159,7895,8137,7647,8106,7925,8029,8052,8160,6111,6141,7998,7676,15018,16000,13995,1367
9,10236,10235,11199,12136,14909,15507,14747,15139,13290,13756,15452,15125,15640,15045,14701,14776,1412
4,13782,14161,13559,14964,15025,13982,13181,11503,12180,12010,12117,14710,15560,14211,13749,14759,1589
2,14036,14003,14802,15129,13263,14150,11749,11951,11996,12086,13182,14103,15466,14586,14707,15510,1378
5,13941,11251,12200,12024,12110,14817,14910,15684,14749,11902,11253,12225,11993,15445,14939,14702,1588
1,13798,14050,15623,15391,14804,15906,14130,13663,14991,15236,15141,14951,12167,11768,12089,12122,8116 ,7918,7163,8039,8131,8113,7926,7423,15502,15020,13991,13297,10223,10175,12006,11751,15745,15046,13754,1
4162,15523,14765,13243,14027,15130,14588,15450,14709,14941,15568,15184,15026,13774,14218,15049,14968,1
4177,13292,13946,14109,14006,14217,15652,14818,15142,15468,13887,13795,15419,14763,14064,13693,15513,1
5240,15905,14750,12194,11959,12017,11135,14023,14119,15627,14559,15462,15890,13781,13298,11679,11246,1
2118,12131,12179,11901,11742,12226,14999,15028,15171,15664,8087,8043,8138,7807,8108,7929,7165,8079,142
72,13743,14955,14808,12092,12174,10238,10239,13245,14153,15473,14791,11963,12012,11755,12137,15132,155
25,15937,15145,15050,15584,15057,15173,15052,15422,13271,13998,15638,15688,13246,13802,8030,8145,7551,
7923,8134,8114,8023,7166,15200,15146,15509,14942,14164,14056,15530,15248,14009,14226,15439,15058,15032 ,14713,13948,13788,13691,14180,15760,14771,14107,14029,13804,13275,11254,11710,11983,12171,15629,15896 ,14220,13751,15153,15465,16128,14655,13300,14131,14957,15516,11257,12208,12121,12134,12009,11757,12018 ,12181,14037,13287,15148,14820,15681,14766,15908,15474,12063,11899,12232,12115,15635,15174,15003,15555 ,11995,11741,11258,12140,14126,13565,14824,15447,11965,11231,12173,12079,14575,14714,14795,14958,15746 ,14963,13935,14213,14773,14716,13786,14030,8046,8091,7903,8051,7671,8140,7930,8103,15537,15944,15154,15
514,13801,14168,14005,13304,8146,8057,8093,8161,7678,7932,8054,8109,14241,14125,15630,14797,141
55,1391
9,15879,14832,15005,15526,13757,14035,15653,150
15,13055,14192,14012,13812,15476,15415,11765,12
195,1222
8,12124,13277,13694,14042,14110,15557,15060,151
77,15641,14965,15920,14687,14803,11966,12188,12
020,1175
8,15696,14774,15451,15073,14587,14798,14778,147
77,14123,13787,16002,14805,15885,14583,15019,15
532,1126
0,12007,12145,12091,14232,14151,14178,13755,121
33,12185,11997,11770,13291,13810,15562,15178,15
748,1546
3,15074,15480,12198,11711,11247,12240,14051,139
83,15644,15235,15938,15006,14138,13278,13293,14
225,1565
4,15119,15421,15185,14010,14133,8148,8045,8110,7
919,8152,7675,8115,8094,15891,15529,13783,13943,
12087,1
2138,11763,12182,15156,15912,15064,15264,15127,
14703,14053,14244,15712,15237,13775,14038,15569
,14966,1
4157,13809,8053,8135,8162,7871,8060,7999,8118,81
39,15657,15021,15180,15540,14969,15047,13247,14
184,122
01,12111,12011,11769,13551,14228,15454,14589,15
027,15637,15160,15511,14058,14165,15238,15022,1
6004,155
58,13797,13999,15752,15469,15076,15683,12152,11
998,12229,12186,11766,12146,12123,12013,14044,1
4134,151
86,14711,15894,14780,13299,14248,15642,14806,15
503,14819,15883,14751,14072,14158,12197,12093,1
2216,112
55,13950,13301,14821,15241,14273,14041,15538,15
131,14809,15576,14970,15080,14215,13816,15952,1
5188,141
37,14170,15296,15658,15201,15029,14054,13799,11
991,12233,11743,12202,15467,16130,15686,15133,1
5561,159
40,15907,15242,14242,14007,15588,15051,15477,15
666,14065,13183,8164,8121,7931,8058,8149,8031,71
67,8107,
12021,12125,12148,12256,15143,14810,14972,15515
,10207,10237,12094,11772,15030,14590,13727,1329
4,8142,7
927,8168,8124,8047,8117,8147,7933,15886,16001,14
166,14179,15053,15407,15651,14911,15249,15776,1
5134,15
147,14715,15544,14227,13949,15689,15527,13790,1
4274,15033,15900,14140,14222,14767,15478,14943,
15564,12
212,12014,11259,12135,14825,15660,14011,14060,1
5202,15059,13803,14185,12227,12209,12022,11519,
14822,15
909,15517,15570,15244,16129,15897,15054,13302,1
3758,15149,15700,14031,14219,14812,15192,12183,
12139,12
234,11903,15453,15747,15175,15665,15631,15482,1
5061,15034,15808,15250,13305,14256,15585,15088,
15204,15
155,8141,8176,8122,8061,8154,7663,8163,8150,1568
5,15150,14775,15265,14169,14182,15533,15914,140
57,1380
5,14826,15475,14066,14229,14111,13947,16016,149
59,14280,14163,15968,15672,14043,13789,15007,15
534,1569
8,15075,12204,12025,11261,12175,13306,14188,159
39,15893,14013,13279,15749,15252,12126,12241,11
647,1201
9,15639,14799,15572,15179,12230,12210,12119,112
62,15471,14717,16008,15690,12142,12187,11999,12
147,1483
3,15922,15266,15157,15062,15297,15539,15518,142
21,14127,15208,15754,8095,8055,8165,8153,7934,81
70,8119,
8156,14828,15586,15668,14967,13813,14243,14276,
14172,14014,14236,15910,15559,15065,15481,15941
,15036,1
4068,13806,16132,14779,13308,14055,14193,14139,
15643,15077,14181,14233,15714,15898,15692,15541
,15181,1
5655,15256,14718,11767,12236,12026,12199,15921,
15158,15761,15187,15565,15066,15945,14834,12242
,12153,1
2189,12257,14045,13818,15216,15592,15078,14781,
15728,14807,11774,12028,12150,12205,14246,13759
,13295,1
4288,14971,15484,16032,15268,15916,15023,14135,
14186,15546,15756,15948,15661,13811,14230,16136
,15239,1
5470,15161,14249,14159,15571,15697,14059,13817,
14836,15913,15182,16006,15531,15081,14200,14046
,12244,1
2141,12206,12015,15162,15068,14277,14234,15600,
14782,15298,15762,15956,15272,15713,14811,13814
,14194,1
5189,15646,15203,14973,15887,15566,14171,14061,
15750,15243,12248,11771,12211,12190,15542,16003
,15924,1
5669,14823,16144,14245,14141,15031,15777,15423,
15082,12149,12231,12258,11967,14264,13303,15164
,15089,1
5946,15190,15573,15662,14039,14281,13791,14250,
8111,8059,8169,8166,8125,8062,8177,8143,15193,15
704,155
45,14840,15135,15691,14591,15300,14069,14173,15
578,15245,14196,14304,16009,15895,15645,15055,1
5479,148
13,15953,15251,15784,15716,12156,12095,12214,12
235,14974,15084,14142,13820,15280,16064,15667,1
5563,152
05,15928,15764,14827,15035,15589,14260,14062,12
260,12217,12027,12154,12245,12127,11263,12203,1
5687,150

90,13307,14183,15519,15901,15194,15954,15753,15812,14814,15304,15596,14719,14275,14257,15548,15246,16137,15151,15915,15312,14070,13567,15206,16020,15969,15253,14231,14187,15673,15577,14282,13951,15942,16160,15063,15486,15778,14829,15693,15587,14252,14073,8172,7677,8155,8126,8178,8123,8167,8157,12238,12023,12264,12220,16012,15209,13309,14223,15720,15037,15902,15267,15659,16134,15701,15809,15092,15670,15196,14835,15067,15984,15574,15159,15911,15258,15535,16010,14174,14289,15210,15768,15757,15254,13695,14067,14278,14258,15972,15590,12143,12213,12243,12029,14838,16131,14167,13310,15269,15702,14190,14235,15674,16018,15923,15547,15824,15079,15694,15096,12237,12272,12218,12157,15580,15917,15217,15483,14830,15715,15608,15038,15257,15960,14837,15212,14047,14195,15751,15183,16192,15780,15328,16033,13815,14284,14074,14247,8180,8151,8174,8158,8184,7679,8171,8173,14783,15943,15772,15705,14290,14201,15593,16040,14237,14305,15069,16133,13822,14076,16005,15676,15567,15163,15926,15270,12250,11759,12259,12246,15970,15810,15218,15273,12191,12151,12261,12249,15299,15755,15083,15601,15455,14841,15717,15191,15260,16146,14198,14253,15070,15165,15899,15549,15947,15699,14292,14189,15766,15594,16024,15722,15301,15950,16066,15575,14254,14063,15274,15220,8179,8181,7935,8182,8185,8063,8186,8183,14296,13819,14842,15663,15925,16140,14259,14238,15085,15706,15976,15281,15302,15792,16017,15091,12030,12266,12215,12252,15602,15195,14197,14279,15763,15929,15724,15276,15550,15166,16145,15247,12207,12155,12265,12262,15957,15918,16168,15207,14306,14015,14975,15816,16034,15671,15224,15708,15581,14815,15758,15604,14204,14143,14262,14283,15282,16068,16013,15086,16138,15962,15729,15305,14308,14265,14844,15949,15197,15782,16193,15675,15093,15718,15306,16036,15579,15255,14075,14202,15930,15769,16162,15840,15211,15971,15595,15198,12221,12158,12273,12239,14293,14175,16256,16011,13311,14251,15781,15094,12268,11773,12251,12222,15485,15284,15695,16152,15932,16007,16048,15313,15721,15259,15958,15308,15770,15647,14286,14071,16065,15097,15732,15213,14312,14268,15543,15811,15785,16148,15288,16022,14831,15598,14191,14261,15980,15955,15677,15765,16161,15039,15707,15974,12274,12219,12263,12253,15903,16072,15271,16021,15314,15961,15219,15098,15582,14839,15794,15261,15730,15605,14291,14077,15214,15814,15071,16135,14285,14320,16014,16196,14266,14205,15779,15973,14298,13807,15817,15709,16035,15591,15329,15927,12276,12247,12270,12254,16164,15788,15221,15275,15330,15736,16080,15992,15316,16025,15262,15100,15606,15277,15964,15703,16141,15793,14307,14294,16257,15919,15723,15978,14239,14199,15303,15603,15820,15786,14309,14297,15222,15167,16019,15678,16147,15283,16041,15767,14843,15597,16176,15225,15986,15320,16096,15826,15951,15087,14078,14314,16038,15278,16194,15759,15796,15719,15332,16028,15977,16150,15307,15813,14263,14300,15609,15848,16069,15226,15934,15710,14255,14203,14845,16142,16258,15985,15285,15309,12280,11775,12267,12269,15733,15825,16044,15963,15336,16026,15228,15610,15774,16153,15726,15800,14313,14310,16204,15286,15487,16067,15842,16163,15933,15199,14269,14206,14321,14287,15787,15095,16200,16050,16037,15731,8188,8187,8175,8127,8190,8191,8159,8189,16139,15344,15959,15818,15612,14846,15771,15988,15315,15828,15289,16264,16165,15725,16074,15099,12275,12277,12031,12278,14316,13821,16208,15310,15789,15979,16049,16154,15551,15738,15965,15856,16166,16027,15290,15795,16070,15215,15317,15841,14299,14270,16042,15318,16260,15263,16169,15975,15783,16082,14322,14267,15679,16015,16156,16097,15815,15611,15331,16076,15737,16224,15101,15292,12281,12159,12282,12279,15832,16197,15223,15773,15321,16056,15333,15966,16149,15798,14311,14301,15734,15981,14324,14295,16184,16023,15583,16052,16272,15322,15819,15987,16081,15279,16195,15844,16170,15790,15227,16177,12284,12283,12271,12223,15334,15931,15614,15102,15801,16045,16100,15982,14318,14302,16073,14847,15821,15740,16029,16202,14328,13823,16288,15827,15324,15993,16088,16143,15735,16180,15337,15287,15990,16262,16043,15727,15338

,15804,16172,15830,16209,15607,16030,15229,16259,15797,16084,16051,14315,14317,15311,16198,15230,16151,14323,14325,15833,15989,15846,16098,16178,15711,16039,15345,15802,16210,15291,16075,15822,16266,16225,15340,15994,16157,16054,16265,14079,14326,15935,15843,16112,15741,16071,16167,15829,15346,16320,15791,15293,16201,15319,16046,15294,15850,16212,16104,14329,14207,16057,16274,15996,15836,15739,16228,16155,16077,15852,15323,16268,15799,15348,16179,16085,15335,16174,15613,15983,16261,15834,16078,15849,16216,16053,15352,16289,16173,16203,15967,15805,16083,15103,16240,16060,15860,15325,15742,16090,16158,14330,14327,16171,15835,16280,16199,16226,15803,15339,15858,16099,16031,16186,15326,15341,16273,16058,16181,12286,12287,12255,12285,15831,15991,16101,16292,15823,16086,16205,15857,14332,14331,15295,16232,15599,16276,16106,16213,15845,16047,16092,16182,15347,16296,16120,16206,15998,15349,16321,16089,16263,15864,16185,16218,14319,14271,16102,15847,16290,16055,16113,15231,15775,15342,16214,16227,16275,15997,15838,16322,16188,16270,14334,14335,16059,16108,15851,16233,15350,15806,16079,16267,15353,16304,16217,16230,16105,15853,16114,16277,16159,15995,16328,16211,16091,15837,15354,16236,16061,15327,16269,16175,15861,16291,16324,16220,16062,16284,16116,15854,15356,16103,16241,16187,16229,16281,16093,15866,16294,15807,15343,16336,16183,16234,15859,16278,16297,16207,16107,15865,16248,16094,16325,16282,15862,16242,16219,16109,16293,16189,16312,15351,16087,16329,15839,16298,16117,16221,16244,16352,14303,14333,16190,15868,16308,16110,15355,16231,16323,16305,16118,15615,16279,16235,16330,15999,16300,16121,15357,16271,16222,16337,15743,16115,16326,16306,16215,15358,16238,16283,16095,16243,15863,16332,16122,16295,16338,16249,16285,16353,15870,16124,16246,16301,16340,16237,16302,16111,16344,15867,16307,16286,16245,16327,16354,16063,16252,16191,16310,16331,16356,16313,16123,16250,16341,16223,15359,16299,16334,16119,16360,16316,16239,16309,16339,16125,16333,16368,16314,16253,16346,15855,16355,16342,16287,16247,16357,16345,16126,16362,16311,16348,16303,16251,16361,16358,16317,16254,16369,16335,16364,15869,16347,16318,16370,16315,16359,16349,16372,16343,16366,16350,16376,15871,16363,16365,16371,16373,16127,16374,16377,16255,16378,16375,16380,16379,16367,16319,16382,16383,16351,16381]

**Sequence group 7: Z7_16384**

[0,1,2,7,3,8,11,24,4,10,13,28,16,33,35,77,5,12,14,32,19,38,47,81,22,46,42,88,57,96,102,168,6,17,21,40,23,45,51,90,29,55,59,97,72,110,116,186,34,61,75,114,80,123,135,197,87,137,148,225,153,238,264,385,9,18,26,54,30,58,71,105,36,76,62,117,84,127,142,206,44,74,86,136,92,145,152,233,100,155,170,252,184,272,291,432,53,89,98,151,111,162,178,269,121,179,196,283,210,305,321,473,139,204,230,311,236,324,349,510,257,357,379,543,400,572,615,879,15,25,31,73,39,79,82,141,48,85,93,150,101,160,165,266,56,94,103,163,115,177,193,286,126,194,205,300,232,318,344,493,64,108,122,183,128,195,213,313,149,228,237,326,256,355,373,542,164,246,270,361,284,393,402,567,307,420,458,602,483,636,714,885,69,124,144,216,159,235,255,359,169,258,275,384,292,401,431,591,191,287,301,413,325,446,477,650,338,486,515,682,551,724,758,1039,212,314,332,462,362,492,519,703,397,539,568,748,604,762,846,1136,429,582,616,801,631,865,901,1201,709,929,967,1192,1011,1269,1375,1794,20,37,41,91,49,95,106,176,50,107,118,187,132,207,217,340,63,119,133,222,146,231,244,341,154,243,265,378,288,396,408,566,67,143,156,224,173,247,271,394,181,279,293,410,304,443,466,628,180,302,316,442,337,480,495,683,366,529,552,723,580,756,806,1101,78,167,174,277,190,298,315,433,198,320,330,475,350,508,533,721,259,345,363,513,386,549,577,750,423,586,622,794,653,862,916,1182,297,381,411,559,439,601,626,848,471,642,666,878,715,944,978,1243,516,711,725,968,751,1013,950,1297,821,1089,1137,1394,1149,1531,1607,1889,83,188,192,336,248,354,372,528,278,377,387,556,422,588,621,850,294,414,438,589,460,627,657,888,487,671,702,934,749,975,1035,1313,339,444,465,6 56,494,693,733,954,554,736,760,1031,822,995,1119,
1412,599,786,856,1093,889,1148,1187,1486,945,119
5,1194,1
587,1299,1639,1699,2096,380,484,530,737,587,761,8
05,1051,623,849,867,1138,926,1157,1193,1525,660,8
97,960,
1183,982,1199,1305,1641,1047,1326,1371,1709,1438
,1817,1886,2309,722,972,1025,1307,1117,1316,1426,
1752,11
34,1418,1496,1845,1558,1925,2038,2502,1159,1544,
1629,1965,1678,2068,2002,2567,1789,2153,2216,275
4,2352,2
848,3015,3419,27,43,52,99,60,120,134,214,66,138,14
7,221,158,241,245,390,68,157,166,240,175,299,308,4
28,200,
310,335,472,352,497,531,746,70,172,189,303,202,33
3,346,490,215,358,374,540,392,573,596,764,229,382,
405,584,
434,620,637,828,448,629,673,896,680,932,973,1389,
109,201,211,351,223,375,391,558,253,409,424,608,4
51,648,6
70,854,276,427,464,634,489,678,689,918,512,691,70
0,977,784,1014,1083,1414,295,488,506,698,548,727,
745,987,
576,783,811,1046,870,1102,1139,1501,607,845,892,1
145,946,1178,1253,1561,1021,1260,1330,1656,1372,
1727,18
34,2298,112,219,242,403,274,425,459,652,290,467,4
91,692,517,705,717,984,319,507,545,719,575,774,80
3,1042,6
05,826,868,1130,919,1160,1227,1506,347,557,595,80
7,638,857,855,1163,661,900,930,1202,989,1257,1285
,1661,7
04,947,1017,1270,1043,1345,1374,1760,1088,1406,1
475,1846,1575,1935,2061,2531,368,614,643,902,688,
943,991,
1261,771,1020,1066,1367,1070,1384,1433,1813,787,
1068,1087,1423,1175,1474,1550,1922,1240,1572,162
7,1968,1
693,2106,2178,2594,827,1189,1216,1509,1290,1591,
1638,2023,1331,1683,1763,2140,1835,2224,2323,278
5,1481,1
769,1853,2241,1962,2378,2427,2969,2025,2473,2565
,3063,2669,3228,3381,4006,129,254,282,470,317,505
,541,75
5,328,550,583,781,609,818,887,1229,360,597,651,85
1,675,941,921,1242,694,961,1010,1325,1062,1351,13
92,1790,
435,664,695,935,770,986,1026,1370,780,1065,1081,1
393,1116,1434,1485,1899,788,1098,1152,1483,1238,
1547,16
19,1971,1280,1671,1692,2113,1768,2179,2277,2733,
450,769,773,1044,793,1069,1129,1456,844,1176,121
3,1527,1
258,1598,1680,2073,1016,1231,1296,1621,1335,1724
,1771,2155,1439,1784,1872,2247,1964,2370,2407,29
59,1080,
1344,1422,1726,1482,1842,1906,2295,1556,1931,198
6,2404,2069,2475,2592,3137,1636,2030,2132,2564,2
211,263
6,2732,3242,2306,2757,2829,3370,2910,3539,3572,4
415,463,795,817,1225,985,1247,1284,1669,1033,131
7,1363,1
743,1430,1805,1897,2285,1085,1390,1477,1821,1523
,1909,1989,2397,1606,2066,1977,2459,2158,2575,26
68,3163,
1241,1487,1546,1943,1659,2006,2115,2554,1705,213
3,2210,2637,2273,2673,2805,3331,1838,2235,2318,2
741,243
5,2868,2949,3467,2498,3052,3106,3646,3229,3756,3
794,4238,1340,1551,1702,2138,1795,2196,2238,2716
,1887,23
47,2382,2822,2461,2869,3067,3566,1903,2443,2556,
3036,2666,3142,3147,3790,2765,3256,3319,3851,344
6,4036,4
135,4725,2076,2630,2638,3210,2818,3260,3372,3889
,2906,3466,3504,4096,3673,4140,4455,4954,3001,36
23,3723,
4294,3864,4337,4580,5137,3963,4614,4720,5330,485
6,5494,5607,6248,140,113,65,289,104,267,182,518,1
25,185,2
03,456,220,356,327,600,161,218,239,334,268,412,37
6,699,306,388,430,569,474,775,640,981,171,249,273,
395,309,
421,481,617,329,509,447,884,555,665,710,1385,353,
485,585,679,538,744,841,1167,610,816,772,1030,917
,1230,10
71,1762,199,296,312,461,348,496,565,718,383,633,5
11,759,598,789,864,1086,415,553,677,829,641,976,8
10,1135,
590,869,1012,1188,940,1450,1268,2152,449,674,611,
927,763,886,1040,1215,708,1099,966,1348,1027,128
9,1670,1
530,800,1050,1121,1497,1166,1368,1413,1816,1217,
1573,1459,2031,1657,2434,1923,2950,234,331,369,5
44,404,5
81,632,847,445,720,603,876,667,924,988,1306,476,6
39,765,933,701,1082,969,1281,792,1032,1153,1373,1
103,142
8,1553,1860,514,754,681,994,866,1063,1161,1403,84
0,1237,1084,1682,1203,1494,1507,1978,928,1150,13
24,1552,
1259,1597,1744,2484,1395,1788,1664,2021,1896,218
1,2276,3096,574,782,893,1131,820,1174,1287,1571,9
51,1360 ,1212,1841,1415,1626,1739,2112,1015,1252,
1429,1676,1526,1772,1970,2199,1327,1917,1804,239
6,2028,2308,256
6,3312,1067,1480,1559,1927,1366,1847,1999,2629,1
637,2102,2193,2406,1888,2755,2503,4244,1698,2141
,2246,27
17,2311,2585,2672,3535,2060,2826,2911,3209,3014,
3909,3380,5407,285,389,426,635,482,726,672,980,50
4,690,85
8,1038,768,1096,1156,1458,564,802,747,1128,863,12
71,1074,1524,942,1177,1304,1590,1224,1812,1725,2
465,606,

877,819,1388,1024,1162,1228,1599,925,1256,1341,1956,1419,1667,1773,2217,1045,1457,1369,1840,1560,1747,1963,2305,1505,1916,2014,2375,2111,2518,2735,3184,649,1118,903,1291,974,1484,1350,1852,1075,1402,1533,1791 ,1596,1926,2024,2436,1186,1677,1508,2189,1435,1958,2007,2675,1785,2099,2225,2536,2307,2623,2831,3611,1246,1708,1594,2039,1823,2154,2379,2811,1934,2458,2195,2712,2272,3055,2944,3483,1640,2346,2584,2979,2474,2874,3278,3460,2639,3222,3097,3844,3427,3699,4037,5586,732,990,1144,1451,1214,1522,1742,2072,1288,1874,1557,2139,1665,1988,2310,2807,1092,1620,1703,2270,1844,2519,2192,2749,1987,2401,2464,3022,2098,3243,2918,4454,1391,1761,1924,2614,2075,2426,2371,3180,1822,2496,2725,2968,2633,3078,3361,3749,2239,2677,2574,3107,2810,3555,3263,3859,2945,3382,3630,4087,3505,4002,4581,4953,1476,1959,2123,2485,1875,2823,2593,3208,2299,2622,3007,3328,2724,3426,3668,4202,2022,2875,2767,3445,3037,3722,3533,4158,3234,3578,3926,4073,3835,4687,4518,5178,2403,3143,2956,3687,3335,4266,3604,4395,2827,3960,3795,4550,3850,4649,4853,6597,3101,4219,4097,4996,4013,4808,5092,5736,4373,5019,4921,5945,5291,7245,5800,7789,367,457,532,757,594,785,859,1158,630,979,823,1312,920,1200,1380,1738,676,871,1041,1236,955,1513,1298,1811,1097,1432,1595,2180,1407,1861,1942,2538,716,1034,983,1362,1120,1427,1570,1976,1239,1679,1495,1902,1660,2029,2287,2701,1179,1618,1545,2020,1746,2218,2114,2631,1843,2271,2400,3373,2440,2958,2830,3686,804,1064,1226,1512,1361,1574,1920,2097,1151,1628,1770,2188,1666,2353,2197,2784,1334,1820,1873,2515,1704,2286,2460,3006,2067,2557,2325,2903,2674,3100,3261,3977,1504,1908,2122,2405,1998,2615,2537,3167,2234,2820,2713,3079,2514,3279,3403,3922,1969,2859,2764,3329,3023,3579,3468,4159,2657,3447,3674,4667,3834,4487,4336,5465,931,1381,1198,1745,1286,2110,1681,2441,1532,1810,1979,2415,1930,2322,2606,3185,1500,2240,2015,2734,1907,2555,2499,3297,2194,2667,2907,3103,2819,3434,3538,4113,1658,2077,2304,2628,2383,2978,2804,3622,2103,2748,3146,3482,2902,3383,3791,4267,2442,3082,2973,3559,3313,3962,3680,4409,3257,3820,4146,4546,4012,4724,4812,6077,1839,2472,2198,2951,2319,2828,3136,3716,2539,3418,3062,3647,3211,3849,3927,4588,2656,3330,3181,4003,3558,3888,4203,5176,3452,4357,4038,4686,4284,4920,5043,5700,2766,3191,3605,4112,3402,4194,4394,4857,3805,4648,4260,5018,4547,5101,5311,5941,3698,4414,4664,5587,4852,5236,5406,6351,4326,5487,5738,6198,5801,6487,6854,8096,1100,1431,1349,2003,1586,2107,1957,2595,1668,1898,2324,3000,2219,2676,2849,3453,1753,2284,2159,2740,2497,3262,2821,3573,2437,2919,3083,3848,3190,3675,4039,4666,1921,2530,2402,2957,2632,3054,3102,3717,2294,3166,3360,4072,3532,3973,3908,4797,2756,3371,3610,3865,3461,4147,4285,4970,3296,4380,4134,4859,4522,5115,5290,6117,2074,2374,2806,3334,2607,3235,3567,4085,2972,3757,3435,3976,2948,4218,4327,5003,3066,3534,3631,4671,3804,4261,4470,5606,3961,4644,4381,5100,4811,5237,5556,6237,3223,3672,4086,4471,3845,4866,4645,5331,4239,4551,4971,5449,4721,5895,5638,6418,4007,4858,5093,5701,5244,6022,5886,6705,5042,5765,6199,6953,6116,6589,7103,8229,2414,2700,2858,3554,3162,3923,3469,4372,3053,3681,3669,4589,3858,4796,4523,5495,3318,4141,3821,4486,4245,4665,4997,5448,4084,4867,5067,5639,4813,5792,5963,6704,3444,3972,4408,4809,4195,5114,4952,5739,4295,5002,5179,6249,5486,5887,5940,6952,4615,5379,5597,5962,5310,6419,6118,6908,5136,6161,6588,7379,6381,7102,7325,8957,3748,4356,4519,5378,4810,5066,5596,6023,4670,5177,5464,6119,5737,6536,6350,7113,4955,5557,5764,6486,5894,6236,6679,7551,5944,6739,6596,7324,6909,7519,7721,9888,5245,5793,6076,6678,6160,6738,7041,7518,6380,7040,6855,7888,7244,7889,7720,8956,6537,7112,7378,7898,7550,7899,8097,8499,7788,8228,8498,8741,8740,9889,9086,9087,130,131,208,251,209,280,323,440,226,322,343,478,370,535,537,791,227,342,364,534,399,570,619,825,436,618,592,860,669,912,948,1248,250,371,407,578,437,613,655,890,479,663,697,913,776,970,1018,1328,536 ,707,779,1008,824,1037,1095,1347,853,1113,1164,1493,1181,1528,1616,2037,281,398,468,662,498,696,767,953,546,790,712,1019,842,1061,1132,1404,612,778,852,1112,894,1147,1180,1511,922,1185,1250,1584,1318,1642,1701,2182,659,861,914,1173,971,1206,1266,1625,1029,12

67,1346,1685,1416,1755,1815,2293,1115,1400,1502,
1793,152
0,1818,1915,2398,1593,1941,2017,2481,2100,2600,2
703,3401,365,441,499,777,571,809,830,1123,624,843
,895,117
2,923,1204,1219,1622,668,898,949,1207,1009,1265,1
339,1694,1060,1342,1401,1736,1510,1808,1910,2369
,734,96
4,1036,1315,1072,1343,1421,1801,1165,1498,1521,1
832,1592,1933,2001,2480,1218,1562,1630,1967,1686
,2079,21
04,2573,1775,2136,2244,2664,2327,2758,2970,3413,
753,1048,1146,1436,1197,1515,1589,1961,1249,1604
,1649,20
36,1706,2101,2177,2627,1337,1695,1737,2131,1819,
2226,2317,2790,1900,2348,2425,2880,2501,3002,306
4,3719,1
420,1802,1862,2254,1984,2368,2439,2923,2087,2477
,2586,3032,2670,3080,3282,3916,2163,2610,2714,31
79,2747,
3337,3437,4077,2961,3471,3575,4068,3657,4247,445
3,5230,406,547,579,891,625,899,962,1264,654,963,1
022,132
9,1090,1405,1437,1904,713,1023,1091,1478,1154,15
03,1554,1905,1184,1549,1617,2016,1696,2086,2120,
2572,739 ,1133,1190,1492,1255,1563,1631,2084,128
3,1663,1707,2128,1754,2221,2274,2744,1282,1740,1
806,2220,1891,232
0,2373,2881,1990,2457,2512,2999,2608,3060,3188,3
863,808,1245,1262,1651,1336,1722,1803,2183,1364,
1814,185
4,2297,1918,2394,2467,2997,1605,1911,1985,2413,2
062,2487,2605,3034,2143,2620,2726,3176,2809,3332
,3454,40
58,1721,2019,2129,2553,2209,2659,2742,3284,2279,
2786,2846,3400,2971,3510,3602,4193,2432,2963,300
3,3576,3
035,3659,3552,4287,3241,3833,3917,4484,3925,4765
,4875,5377,831,1332,1338,1890,1568,1932,2000,245
6,1662,2
013,2063,2528,2142,2624,2719,3286,1710,2134,2208
,2625,2252,2743,2817,3416,2349,2851,2922,3498,30
33,3595,
3703,4325,1901,2222,2269,2816,2372,2905,3013,355
6,2516,3020,3076,3697,3258,3645,3893,4528,2651,3
158,331
4,3847,3417,3924,4065,4630,3511,4071,4070,4855,4
293,4937,5069,5748,2018,2344,2462,3021,2621,3077
,3187,37
59,2727,3285,3339,3918,3464,3975,4069,4749,2824,
3433,3564,4059,3608,4075,4297,4939,3751,4364,442
9,5079,4
590,5263,5350,6105,2998,3592,3683,4299,3891,4338
,4568,5112,3910,4544,4650,5307,4800,5471,5676,64
16,3979,
4780,4915,5539,5020,5698,5604,6473,5191,5873,594
6,6812,6162,6954,7189,7723,469,593,658,915,706,10
28,1094 ,1424,738,1114,1155,1473,1196,1535,1555,2
070,752,1191,1244,1534,1263,1723,1786,2162,1382,
1792,1885,2292,
1928,2377,2463,3030,766,1254,1333,1741,1386,1863
,1912,2354,1425,1960,2004,2478,2078,2601,2648,30
98,1499,
2026,2109,2612,2190,2718,2759,3270,2232,2745,285
7,3432,2872,3496,3593,4475,965,1383,1417,1919,14
79,2005,
2071,2552,1585,2121,2156,2692,2237,2788,2850,329
8,1650,2161,2268,2752,2351,2870,2883,3456,2412,2
901,292
0,3601,3156,3660,3803,4530,1711,2350,2392,2916,2
486,3005,3029,3615,2604,3155,3221,3750,3368,3866
,3919,46
69,2679,3281,3424,3921,3536,4056,4217,4803,3671,
4236,4366,4956,4430,5097,5288,6078,992,1449,1548
,2105,16
48,2157,2245,2808,1700,2275,2355,2904,2433,2947,
2975,3612,1809,2393,2483,2977,2603,3144,3183,374
0,2671,3
268,3362,3902,3457,4000,4133,4704,1913,2529,2635
,3189,2772,3315,3299,4005,2825,3436,3480,4078,36
21,4221,
4263,4969,2946,3537,3663,4256,3741,4393,4452,511
6,3832,4520,4607,5308,4835,5517,5679,6433,1996,2
702,278
7,3438,2882,3509,3629,4237,3139,3670,3784,4411,3
788,4472,4579,5261,3159,3786,3823,4549,4041,4606
,4792,54
68,4190,4832,4913,5544,5065,5794,5888,6522,3269,
4067,4102,4707,4270,4865,4936,5657,4367,5041,511
9,5858,5
289,5964,6123,6853,4625,5139,5329,5991,5536,6188
,6251,7115,5659,6365,6455,7223,6667,7450,7655,84
42,1073,
1588,1684,2278,1807,2381,2479,3039,1836,2500,261
1,3153,2693,3232,3415,4143,1966,2649,2791,3287,2
865,350
7,3459,4192,2908,3565,3656,4359,3772,4403,4482,5
228,2191,2844,2909,3499,3138,3614,3684,4428,3152
,3775,38
01,4483,3890,4582,4629,5391,3160,3860,3942,4627,
4188,4783,4905,5547,4258,5001,5064,5805,5138,588
9,6053,6
777,2236,3105,3141,3742,3165,3787,3901,4598,3280
,4042,4099,4751,4222,4872,5022,5703,3662,4145,42
86,4907,
4375,5094,5157,5875,4591,5188,5338,6021,5538,618
4,6223,7101,3800,4392,4548,5096,4626,5304,5420,6
075,479
8,5493,5558,6220,5699,6367,6520,7305,4922,5666,5
838,6454,5943,6634,6776,7478,6090,6815,6921,7622
,7034,78
55,7896,9035,2255,3177,3231,4115,3613,4201,4262,
4999,3701,4339,4407,5103,4576,5239,5389,6055,380
7,4480,4
613,5281,4727,5423,5585,6197,4874,5696,5549,6325
,5884,6475,6666,7357,4191,4631,4782,5519,4959,56

36,5807,
6446,5077,5839,5942,6635,6039,6673,6873,7613,5292,5967,6120,6805,6261,6958,7043,7827,6410,7206,7286,803
8,7451,8192,8224,8742,4382,4793,5070,5856,5231,5920,5988,6706,5351,6135,6190,6902,6327,6959,7247,7890,54
05,6315,6452,7204,6664,7306,7327,8194,6849,7504,7597,8299,7816,8470,8619,9313,5726,6618,6644,7434,6882,7
506,7652,8325,7032,7826,7844,8550,8043,8632,9045,9542,7149,8035,8117,8896,8310,8913,9224,9779,8391,9248,
9298,10014,9512,10206,10299,10882,1122,993,735,1697,952,1623,1314,2438,1049,1319,1387,2242,1472,1940,18
33,2658,1205,1448,1529,1884,1624,2130,2012,2917,1774,2064,2176,2587,2296,3145,2774,3607,1251,1569,1643,2
085,1787,2137,2321,2715,1837,2395,2227,3412,2517,2845,2962,4473,1929,2345,2613,2871,2476,3028,3277,4015,
2694,3230,3140,3696,3455,4144,3789,5118,1365,1720,1800,2253,1914,2376,2559,2976,2027,2751,2399,3065,265
0,3161,3336,3822,2135,2513,2867,3271,2775,3600,3220,3911,2626,3363,3658,4066,3506,4596,4246,5872,2233,28
64,2695,3465,3081,3414,3720,4101,2960,3861,3574,4400,3685,4269,5000,4764,3178,3758,3895,4651,4014,4412,4
529,5262,4103,4833,4605,5667,4957,6260,5469,7072,1514,1855,1997,2482,2108,2609,2750,3283,2223,2996,2665,
3374,2847,3462,3620,4298,2316,2773,3099,3497,2921,3802,3577,4259,3164,3700,3943,4431,3867,4570,4795,533
6,2424,3038,2873,3644,3338,3773,4001,4517,3276,4157,3806,5040,4079,4646,4705,5550,3470,3940,4358,4794,42
23,4871,5108,6382,4485,5190,4984,5647,5388,5891,6052,7272,2602,3154,3425,3903,3240,4040,4265,4815,3553,4
404,4098,5295,4531,4912,5099,5804,3661,4216,4571,5016,4750,5158,5546,5923,4365,5451,5238,6196,5664,6104,
6472,7566,3785,4624,4801,5485,4410,5309,5599,6617,4923,5766,5901,6222,5376,6813,6417,8804,5068,5859,602
0,6707,6107,6485,6672,7853,5678,6910,7035,7433,7188,8327,7654,10043,1687,2065,2160,2753,2326,3004,2856,3
606,2380,2900,3316,3718,3104,3856,3974,4604,2558,3182,3031,3900,3333,4257,3792,4748,3508,4043,4296,4864,
4114,5260,5095,6349,2678,3375,3233,4474,3682,4004,4142,4873,3463,4220,4383,5524,4545,4987,5159,5947,374
3,4599,4413,5294,4802,5111,5537,6089,4685,5450,5644,6187,5803,6422,6779,7400,2789,3892,3439,4271,3594,46
28,4402,5328,3793,4516,4767,5229,4870,5484,5658,6262,4064,5017,4706,5893,4583,5526,5637,6675,5189,5751,5
965,6434,6091,6599,6923,8033,4200,5078,4868,5677,5283,5874,6189,6881,5516,6324,5903,6694,6038,7221,7038,
7843,4938,6134,6484,7127,6366,7008,7548,7824,6645,7448,7273,8246,7737,8101,8471,10242,3012,3628,3920,45
97,4100,4726,5102,5702,4268,5348,4799,5857,4985,5584,6106,6875,3846,4906,5071,6036,5306,6423,5900,6807,5
559,6213,6348,7190,5750,7479,7036,9044,4481,5117,5470,6590,5725,6250,6185,7376,5282,6408,6737,7114,6633,
7256,7621,8119,5989,6677,6474,7287,6880,7869,7517,8309,7039,7660,8036,8549,7845,8440,9225,9541,4612,552
7,5837,6383,5349,6903,6521,7432,6079,6598,7151,7598,6736,7736,8040,8716,5656,7009,6851,7791,7205,8116,78
47,8692,7476,8008,8358,8545,8245,9297,9066,9838,6215,7307,7074,8099,7615,8844,8010,8959,6911,8388,8225,9
134,8298,9253,9455,11325,7275,8719,8551,9598,8469,9436,9724,10412,8941,9659,9523,10665,9891,11765,10468 ,12357,1991,2243,2466,3061,2634,3157,3317,3978,2746,3603,3259,4324,3458,4076,4468,5098,2866,3369,3721,41
56,3557,4723,4292,5247,3857,4578,4869,5890,4521,5337,5518,6444,2974,3702,3609,4406,3894,4569,4814,5548,4
189,5021,4647,5404,4968,5665,6073,6693,4057,4904,4781,5646,5110,5960,5806,6619,5305,6037,6212,7653,6312,
7100,6922,8098,3186,3774,4132,4722,4405,4834,5466,5749,3941,4914,5156,5892,4986,6163,5921,6852,4374,528
0,5339,6421,5076,6072,6326,7150,5697,6453,6133,7011,6674,7274,7507,8427,4684,5422,5836,6221,5598,6591,64
35,7359,5966,6900,6695,7257,6420,7549,7663,8356,5545,6957,6848,7599,7191,8009,7840,8693,6647,7817,8088,9
289,8244,9065,8912,10103,3481,4469,4074,5109,4264,5802,5023,6313,4766,5246,5551,6239,5492,6122,6538,740
1,4668,5990,5645,6778,5421,6447,6411,7565,5902,6665,7033,7285,6883,7738,7854,8617,4958,5727,6088,6616,61
91,7126,6872,8034,5767,6806,7326,7842,7010,7661,8195,8845,6314,7258,7125,7871,7567,8390,8090,9033,7505,8
230,8634,9132,8468,9312,9452,10691,5293,6364,5922,7073,6121,6920,7304,8102,6445,7722,7222,8039,7

435,829
7,8359,9226,6646,7612,7377,8441,7870,8324,8717,9
836,7818,8915,8496,9296,8846,9522,9721,10314,685
0,7403,8
011,8616,7662,8694,8958,9513,8227,9252,8806,9658
,9133,9727,10013,10607,8100,9034,9254,10243,9454
,9880,1
0042,11017,8898,10205,10414,10878,10469,11131,1
1536,12570,3862,4577,4401,5605,4854,5795,5525,65
23,4998,
5390,6132,7148,5961,6676,6955,7819,5113,6054,588
5,6804,6409,7516,6901,7897,6263,7037,7259,8296,7
402,808
9,8497,9288,5467,6432,6214,7075,6632,7220,7284,8
103,6074,7358,7620,8544,7846,8425,8326,9315,6814
,7623,80
32,8311,7825,8635,8847,9596,7564,8942,8618,9515,
9084,9777,9890,10817,5724,6186,6874,7614,6539,74
77,7891,
8547,7124,8193,7739,8426,7042,8718,8899,9657,724
6,7852,8037,9291,8226,8807,9046,10298,8389,9250,
8943,97
26,9439,9881,10240,10881,7449,8042,8548,9047,824
7,9520,9251,10015,8743,9135,9597,10101,9299,1060
5,10312 ,11128,8443,9514,9725,10315,9882,10688,1
0470,11357,9720,10449,10879,11609,10816,11175,1
1745,12745,6238,
6692,6956,7868,7356,8357,7841,8940,7207,8091,804
1,9227,8308,9314,9085,10207,7596,8633,8231,9064,
8805,92
55,9599,10100,8546,9521,9723,10313,9453,10450,10
667,11356,7790,8424,9032,9437,8695,9776,9540,104
15,8897 ,9656,9839,10883,10204,10471,10606,11608
,9249,10041,10297,10666,10012,11129,10818,11538,
9778,10877,111
74,11937,11019,11744,11767,12895,8118,8914,9067,
10040,9438,9722,10296,10689,9290,9837,10102,108
19,1041
3,11172,11016,11747,9543,10241,10448,11130,1060
4,10880,11327,12073,10664,11359,11324,11766,115
39,11939,
12075,13602,9883,10451,10690,11326,10876,11358,
11611,11938,11018,11610,11537,12358,11764,12359
,12074,1
2894,11173,11746,11936,12568,12072,12569,12571,
12747,12356,12744,12746,12893,12892,13603,13600
,13601,2
60,261,262,419,263,452,455,684,416,454,501,728,56
0,741,743,1125,417,500,502,740,563,798,875,1141,6
46,874,8
14,1208,957,1232,1294,1652,418,561,645,812,647,87
3,883,1210,729,939,959,1233,1076,1310,1376,1758,7
42,997,
1079,1322,1140,1399,1463,1781,1171,1489,1540,193
7,1565,1982,2116,2581,453,562,686,938,730,958,105
9,1301,
796,1124,998,1377,1168,1411,1518,1850,872,1078,1
170,1488,1220,1537,1564,1973,1292,1567,1654,2056
,1756,21
44,2215,2760,937,1209,1234,1543,1311,1634,1690,2
125,1397,1691,1780,2167,1858,2281,2329,2897,1491
,1848,19
54,2291,1980,2332,2445,3018,2081,2453,2571,3087,
2652,3212,3343,4083,503,685,731,1077,799,1127,11
42,1517,
880,1169,1221,1542,1293,1632,1645,2118,956,1222,
1295,1635,1323,1689,1777,2186,1410,1778,1849,226
4,1972,2
314,2428,2981,1052,1308,1398,1751,1452,1779,1877
,2301,1541,1952,1981,2334,2080,2451,2561,3086,16
44,2010,
2126,2469,2184,2597,2654,3195,2283,2720,2854,326
6,2927,3408,3642,4105,1057,1408,1536,1880,1603,1
975,205
9,2455,1653,2082,2147,2580,2228,2653,2739,3247,1
767,2187,2265,2697,2333,2814,2913,3430,2418,2954
,3027,35
70,3123,3712,3778,4479,1876,2302,2408,2862,2470,
2980,3051,3599,2617,3075,3196,3752,3272,3782,398
2,4744,2
737,3226,3364,3897,3399,4045,4137,4889,3625,4185
,4303,4860,4379,5045,5243,6102,644,797,813,1211,8
81,1223 ,1302,1688,882,1303,1378,1759,1460,1851,1
881,2420,999,1379,1461,1894,1538,1955,2008,2421,
1566,1995,2117,
2570,2212,2616,2688,3194,1055,1519,1600,1936,167
3,2011,2127,2598,1749,2151,2229,2690,2280,2803,2
878,339
6,1748,2266,2312,2802,2417,2924,2983,3571,2534,3
057,3124,3679,3224,3776,3906,4641,1126,1647,1674
,2149,17
66,2250,2303,2761,1782,2328,2358,2899,2446,3016,
3069,3677,2083,2429,2471,3025,2582,3121,3217,375
4,2723,3
238,3378,3886,3441,4034,4152,4822,2249,2577,2691
,3151,2771,3265,3394,4008,2887,3422,3502,4082,36
43,4232,
4334,4979,3048,3627,3713,4320,3755,4385,4242,508
9,3953,4593,4745,5286,4757,5595,5723,6257,1143,1
764,177
6,2416,2032,2450,2560,3056,2150,2569,2583,3148,2
722,3244,3377,4010,2230,2698,2770,3245,2860,3395
,3449,41
08,2955,3531,3598,4198,3753,4331,4467,5129,2419,
2812,2877,3448,2982,3585,3725,4282,3126,3736,378
0,4451,3
954,4371,4683,5332,3255,3870,4020,4601,4109,4756
,4839,5446,4233,4863,4862,5655,5091,5819,5907,66
08,2576,
2952,3058,3737,3239,3781,3905,4535,3379,4009,404
7,4746,4174,4777,4861,5589,3484,4129,4288,4823,4
342,487
9,5105,5821,4527,5142,5235,5937,5386,6145,6254,7
005,3678,4328,4425,5107,4681,5132,5370,6032,4742
,5342,54
80,6193,5630,6333,6542,7322,4779,5616,5797,6393,5862,6576,6458,7423,6097,6741,6808,7718,7052,7828,8095,8651,687,815,936,1235,996,1396,1462,1878,1054,1490,1539,1893,1602,1993,2009,2590,1056,1601,1646,1992,1675 ,2251,2288,2736,1796,2290,2411,2896,2448,2993,3059,3746,1058,1672,1765,2267,1798,2409,2430,2966,1879,2454,2562,3084,2596,3213,3252,3796,1953,2578,2661,3236,2762,3376,3409,3964,2840,3397,3541,4128,3568,4196,4329,5269,1309,1797,1859,2447,1895,2563,2591,3150,2057,2689,2728,3300,2843,3428,3530,4018,2148,2731,2876,3406,2965,3562,3581,4154,3024,3583,3596,4333 ,3868,4386,4575,5334,2231,2964,3010,3590,3120,3715,3745,4355,3216,3855,3915,4526,4062,4642,4747,5489,3275,3981,4116,4753,4234,4818,4993,5633,4397,5032,5154,5840,5240,5987,6166,6998,1320,1883,1994,2655,2146,2729,2855,3440,2214,2879,2967,3584,3049,3617,3665,4352,2315,3011,3109,3667,3215,3838,3899,4514,3273,3958,4060,4738,4155,4784,4927,5514,2431,3149,3251,3907,3410,4021,4019,4787,3485,4136,4186,4890,4361,5005,5053,5845,3616,4235,4389,5046,4515,5185,5242,6048,4592,5318,5435,6194,5651,6363,6553,7355,2540,3342,3423,4138,3580,4207,4363,5033,3819,4396,4558,5227,4562,5264,5381,6129,3871,4560,4587,5347,4807,5434,5622,6330,4976,5648,5763,6396,5897,6622,6762,7474,3959,4849,4916,5521,5074,5663,5818,6507,5155,5879,6051,6708,6167,6828,7019,7757,5441,6057,6209,6897,6390,7118,7219,8013,6509,7277,7421,8163,7585,8396,8605,9414,1453,2058,2166,2886,2313,3009,3085,3771,23 56,3 122,3227,3 853,3 301,3938,4107,4941,2468,3253,3431,4011,3543,4205,4169,4978,3586,4289,4378,5141,4554,5203,5284,6098,2763,3500,3587,4199,3818,4354,4426,5234,3852,4557,4573,5285,4680,5382,5445,6291,3880,4610,4760,5443,4974,5619,5743,6399,5048,5855,5896,6641,6056,6763,6977,7657,2842,3817,3837,4524,3885,4561,4737,5416,3980,4816,4909,5591,5006,5674,5876,6581,4388,4943,5088,5745,5171,5984,6059,6743,5387,6092,6232,6907,6392,7078,7187,8003,4572,5184,5346,5986,5442,6174,6306,6995,5628,6347,6438,7184,6577,7279,7472,8233,5816,6526,6696,7420,6803,7544,7656,8414,7002,7725,7805,8574,7934,8803,8856,9871,2863,3887,3937,4925,4353,4983,5052,5853,4465,5133,5207,6015,5374,6113,6289,6981,4585,5270,5437,6149,5555,6309,6441,7177,5722,6558,6413,7263,6746,7439,7584,8303,4977,5447,5618,6379,5843,6462,6643,7406,5925,6697,6802,7545,6965,7589,7773,8503,6170,6879,7014,7697,7227,7872,7981,8711,7310,8132,8214,8974,8397,9128,9174,9654,5180,5623,5910,6702,6103,6796,6886,7636,6255,7047,7122,7798,7265,7873,8167,8842,6295,7243,7416,8128,7574,8238,8243,9170,7741,8428,8479,9223,8690,9440,9551,10229,6584,7530,7546,8386,7794,8432,8600,9273,7930,8710,8756,9524,8997,9560,9895,10514,8065,8955,9043,9734,9244,9781,10084,10693,9359,10114,10224,10886,10388,11022,11135,11760,1516,1321,1053,2213,1300,2119,1750,3050,1409,1757,1799,2852,1892,2452,2335,3264,1633,1882,1983,2410,2124,2696,2568,3591,2282,2588,2738,3197,2898,3839,3420,4341,1655,2033,2145,2599,2289,2721,2925,3365,2357,3017,2815,4104,3127,3501,3626,5265,2449,2953,3237,3563,3074,3744,3969,4791,3302,3936,3836,4450,4153,4942,4563,6050,1783,2248,2300,2861,2444,2992,3193,3666,2579,3405,3019,3779,3254,3881,4044,4586,2699,3125,3561,3965,3421,4332,3914,4743,3246,4061,4384,4848,4204,5402,5044,6740,2841,3542,3303,4175,3783,4106,4512,4911,3624,4611,4302,5200,4427,5073,5854,5594,3896,4534,4709,5481,4790,5232,5333,6144,4917,5649,5419,6527,5841,7226,6331,7982,1974,2359,2541,3108,2660,3225,3404,3983,2813,3676,3267,4080,3503,4172,4360,5106,2912,3411,3797,4197,3597,4574,4321,5049,3884,4464,4761,5241,4643,5372,5625,6216,3026,3770,3569,4370,4046,4555,4785,5315,3968,4973,4584,5878,4891,5454,5515,6414,4184,4758,5140,5624,5007,5673,6016,7292,5287,6096,5848,6505,6288,6765,6976,8196,3214,3854,4117,4739,3952,4806,5055,5643,4243,5204,4908,6173,5335,5762,6011,6640,4387,4992,5373,5860,5590,6060,6398,6799,5143,6321,6112,7176,6524,7004,7422,8472,4559,5440,5631,6335,5226,6195,6451,7529,5817,6614,6793,7186,6256,7719,7323,9660,5906,6709,6906,7637,7007,7453,7588,8783,6552,7802,7935,8385,8094,9301,8604,10955,2185,2589,2730,3407,2926,3714,3540,4340,3008,3582,4022,4478,3816,4608,4776,5418,3192,3898, 3747,4736,4035,5047,4566,5588,4206,4817,5104,5662,4924,6128,5985,7269,3274,4081,3939,5268,4424,4786,494
0,5675,4173,5004,5181,6384,5343,5851,6061,6809,4525,5417,5233,6172,5632,6019,6391,7001,5513,6320,6478,70
99,6639,7334,7659,8332,3429,4682,4139,5075,4330,5444,5202,6208,4567,5314,5601,6099,5672,6334,6508,7228,4
838,5861,5520,6781,5383,6386,6463,7591,6093,6611,6829,7380,7003,7511,7807,8927,4982,5936,5670,6543,6151,
6742,7119,7787,6362,7262,6795,7632,6964,8135,7976,8739,5820,7046,7452,8023,7278,7878,8446,8704,7547,839
4,8197,9216,8655,9019,9441,11106,3724,4362,4752,5403,4910,5554,6014,6580,5072,6234,5629,6703,5849,6440,7
006,7775,4600,5744,5911,6962,6192,7335,6792,7713,6439,7181,7268,8114,6610,8415,7962,9894,5271,6049,6332,
7502,6583,7218,7079,8328,6150,7308,7649,8012,7533,8178,8569,9081,6887,7593,7438,8215,7786,8827,8435,923
1,7977,8606,8970,9519,8757,9410,10085,10513,5436,6387,6671,7293,6235,7799,7473,8384,6999,7510,8071,8500,
7648,8654,8992,9626,6506,7879,7743,8689,8129,9042,8781,9594,8410,8862,9326,9489,9215,10183,9978,10702,7
183,8239,8000,9015,8523,9698,8920,9835,7803,9356,9175,10030,9222,10153,10385,12065,8209,9631,9525,10568 ,9433,10356,10628,11236,9817,10595,10453,11481,10823,12573,11300,13025,2535,2853,3068,3777,3250,3869,40
23,4778,3398,4335,3955,5128,4168,4888,5256,6010,3560,4063,4513,4972,4283,5541,5090,6127,4609,5380,5671,6
764,5319,6217,6378,7382,3664,4466,4343,5206,4708,5371,5642,6412,4975,5863,5455,6294,5844,6525,6983,7617,
4819,5742,5617,6504,6018,6810,6642,7531,6175,6963,7180,8601,7240,8002,7806,9014,3904,4556,4926,5540,520
5,5650,6328,6609,4759,5796,6058,6780,5850,7053,6797,7756,5170,6148,6233,7331,5924,6982,7264,8070,6559,74
17,7021,7903,7590,8208,8433,9397,5512,6308,6670,7185,6450,7503,7381,8307,6878,7796,7633,8179,7330,8447,8
623,9322,6397,7851,7740,8501,8115,8863,8712,9595,7569,8691,8998,10159,9214,9959,9780,10973,4187,5257,48
78,6017,5054,6638,5877,7241,5600,6126,6415,7203,6346,7018,7494,8333,5488,6896,6479,7658,6307,7407,7311,8
465,6794,7575,7931,8211,7795,8674,8802,9545,5842,6585,7000,7528,7123,8022,7772,8954,6615,7712,82
42,8738,
7902,8607,9171,9699,7242,8182,8017,8831,8473,9358,9008,9865,8429,9208,9566,10026,9432,10228,10376,11649 ,6171,7276,6798,7983,7015,7804,8232,9036,7383,8650,8162,8975,8387,9221,9327,10096,7568,8502,8329,9411,88
30,9272,9627,10700,8696,9809,9442,10182,9728,10452,10603,11220,7742,8355,8921,9544,8622,9614,9834,10389 ,9189,10152,9668,10594,10027,10653,10875,11453,9018,9870,10156,11107,10384,10800,10954,11879,9758,1099
1,11238,11710,11301,11963,12222,13248,4640,5375,5201,6459,5654,6623,6385,7475,5852,6290,7020,8064,6811,
7592,7829,8697,6033,6980,6747,7696,7309,8434,7797,8857,7229,7963,8183,9220,8354,8999,9443,10158,6329,73
54,7182,8001,7532,8134,8210,9037,6994,8306,8568,9488,8780,9393,9300,10341,7724,8575,8926,9245,8705,9567,
9729,10554,8464,9820,9550,10391,9982,10675,10822,11669,6582,7098,7774,8522,7495,8411,8843,9517,8016,912
9,8675,9396,7980,9630,9759,10575,8166,8782,8971,10179,9188,9669,9914,11134,9357,10140,9821,10652,10359,
10801,11084,11749,8395,8996,9518,9915,9217,10402,10141,10887,9655,10031,10555,10969,10225,11435,11162,
11894,9415,10390,10629,11221,10804,11542,11418,12157,10602,11261,11711,12333,11668,12037,12439,13293,7
202,7616,7850,8826,8302,9323,8713,9816,8133,9009,8993,10097,9230,10340,9983,11023,8478,9561,9209,9958,9
661,10157,10569,10968,9516,10403,10611,11163,10377,11296,11487,12156,8688,9392,9864,10357,9615,10674,1
0512,11239,9735,10574,10703,11761,10990,11419,11452,12332,10115,10923,11109,11486,10874,11895,11670,12
292,10692,11689,12036,12691,11885,12438,12673,13837,9080,9808,9979,10922,10358,10610,11108,11543,10178 ,10701,10972,11671,11237,12032,11878,12449,10515,11085,11260,11962,11434,11748,12135,12859,11480,12171,
12064,12672,12293,12839,12993,14340,10805,11297,11648,12134,11688,12170,12397,12838,11884,12396,12223,
13076,12572,13077,12992,13836,12033,12448,12690,13090,12858,13091,13249,13495,13024,13292,13494,13677,
13676,14341,13878,13879,1454,1455,1856,2035,1857,2164,2331,2800,1938,2330,2423,2914,2542,3071,3073,3883 ,1939,2422,2532,3070,2619,3198,3367,3957,2768,3366,3248,4032,3529,4148,4240,4988,2034,2543,2663,3218,276
9,3341,3443,4110,2915,3487,3589,4149,3840,4322,4

390,5152,3072,3619,3843,4376,3956,4477,4603,5187,4017,46 53,4788,5453,4821,5592,5740,6541,2165,2618,2884,3486,2994,3588,3799,4281,3110,3882,3640,4391,3970,4553,4 740,5316,3340,3842,4016,4652,4118,4755,4820,5523,4170,4837,4990,5652,5134,5822,5909,6766,3451,4033,4150, 4805,4323,4894,5038,5761,4449,5039,5186,5881,5340,6035,6131,6993,4655,5312,5490,6101,5552,6146,6319,717 8,5669,6377,6481,7289,6612,7488,7619,8621,2533,2801,2995,3841,3199,3913,3966,4711,3392,3971,4119,4804,41 71,4892,4919,5746,3528,4130,4241,4895,4377,5037,5175,5898,4552,5182,5313,6008,5522,6124,6310,7077,3726,4 300,4476,5131,4564,5183,5345,6109,4789,5482,5553,6164,5668,6361,6457,7288,4918,5634,5798,6395,5882,6587, 6620,7437,6063,6700,6904,7572,7023,7726,8014,8637,3769,4532,4754,5384,4877,5543,5661,6389,4989,5720,583 3,6540,5926,6613,6761,7515,5173,5899,6009,6691,6147,6830,7013,7770,6292,7048,7217,7892,7321,8066,8164,90 39,5344,6110,6218,6926,6436,7076,7231,7967,6595,7281,7454,8124,7586,8180,8458,9316,6751,7498,7634,8323,7 703,8525,8677,9493,8005,8715,8859,9468,8985,9663,9893,10774,2662,3111,3219,4111,3393,4131,4290,5036,344 2,4291,4398,5153,4594,5317,5385,6304,3641,4399,4595,5438,4762,5491,5626,6305,4836,5621,5741,6480,5904,65 94,6668,7436,3739,4741,4850,5452,4995,5635,5799,6592,5051,5847,5927,6688,6034,6825,6966,7700,5050,6012,6 114,6824,6259,7016,7097,7893,6442,7261,7328,8047,7496,8160,8352,9243,3912,4981,5034,5835,5172,5950,6111, 6767,5224,6130,6210,6997,6322,7146,7271,8045,5721,6311,6437,7201,6554,7295,7493,8126,6711,7508,7650,832 0,7785,8520,8698,9450,5949,6483,6689,7405,6801,7571,7698,8460,6979,7758,7822,8620,8015,8778,8918,9613,72 24,8007,8067,8860,8127,8987,8824,9731,8413,9213,9317,9956,9325,10301,10411,10921,3967,5168,5174,6258,56 40,6360,6456,7260,5846,6477,6555,7352,6710,7512,7639,8462,5938,6698,6800,7513,6924,7699,7793,8648,7049,7 831,7966,8754,8125,8903,9023,9757,6293,6826,6961,7792,7096,7929,8093,8828,7332,8112,8176,9017,8430,8973, 9277,10008,7563,8278,8474,9219,8649,9324,9465,10138,8779,9471,9470,10387,9733,10465,10613,11256, 6482,70 44,7266,8113,7509,8177,8335,9131,7651,8461,8527,9318,8708,9395,9469,10245,7800,8673,8840,9451,8924,9491, 9753,10467,9083,9812,9885,10627,10098,10811,10910,11665,8046,8900,9011,9755,9275,9782,10044,10672,9302, 10024,10154,10855,10352,10987,11188,11892,9399,10316,10431,11059,10596,11218,11132,11949,10771,11373,1 1482,12204,11690,12334,12509,12995,2885,3249,3450,4151,3618,4448,4602,5368,3738,4654,4763,5433,4876,560 3,5627,6578,3768,4851,4980,5602,5035,5951,6094,6750,5258,6100,6253,6992,6344,7117,7267,8122,3798,4994,51 69,6013,5266,6219,6316,7054,5369,6388,6460,7282,6586,7489,7560,8198,5483,6510,6637,7500,6782,7638,7727,8 438,6876,7701,7849,8672,7876,8752,8901,9919,4301,5259,5341,6323,5439,6461,6579,7404,5653,6669,6744,7608, 6885,7768,7830,8466,5834,6749,6960,7716,7051,7874,7895,8700,7200,7901,7964,8917,8276,8988,9187,10010,59 39,7050,7144,7960,7294,8069,8121,8939,7492,8275,8393,9082,8572,9246,9319,10177,7595,8457,8652,9321,8800, 9448,9629,10355,8995,9652,9814,10516,9886,10649,10820,11650,4368,5401,5620,6621,5832,6745,6905,7784,590 8,6967,7055,7928,7225,7979,8019,8936,6125,7145,7291,8021,7491,8240,8331,9068,7587,8436,8570,9294,8701,94 08,9549,10200,6317,7353,7535,8353,7752,8475,8467,9413,7801,8676,8736,9494,8953,9649,9671,10553,7978,880 1,8991,9664,9069,9833,9892,10676,9212,9980,10111,10872,10383,11025,11191,11925,6448,7618,7759,8678,7894 ,8777,8969,9653,8235,8994,9148,9867,9168,9916,10083,10809,8279,9150,9211,10029,9445,10110,10336,10984,9 610,10380,10429,11060,10609,11298,11420,11966,8437,9467,9538,10203,9702,10401,10464,11169,9815,10601,1 0679,11370,10821,11496,11683,12221,10117,10695,10885,11503,11056,11704,11763,12451,11171,11881,11947,1 2559,12111,12734,12907,13454,4565,5660,5880,6978,6115,7121,7283,8131,6168,7320,7499,8273,7609,8408,8639 ,9563,6394,7561,7771,8463,7865,8759,8703,9612,7932,8841,8984,9811,9144,9851,9954,10772,6783,7820,7933,87 55,8234,8938,9012,9884,8272,9147,9185,9955,9274,10086,10137,10927,8300,9240,9354,10119,9608,10319,10425 ,11063,9666,10573,10608,11321,10694,11421,11557,12173,6884,8213,8237,9070,8305,9151,9293,10106,8456,944 6,9527,10247,9650,10408,10598,11223,8990,9565,9730,10427,9819,10630,10697,11375,10099,10768,10906,1154 1, 11058,11692,11727,12437,9184,9832,10028, 10648,10118,10852,10956,11615, 10342,11021,11086,11724,11219, 11883,11964,12653,10454,11186,11354,11946,11455, 12078,12172,12750,11654,12207,12329,12890,12390,13063,13088,13859,6927,8321,8399,9547,8937,9625,9670,10571,9021,9783,9855,10655,10080,10803,10925,11559,9191,9952,10113,10813,10231,10959,11105,11709,10410,11216,11081,11873,11416,11951,12110,12677,9611,10139,10318,11027,10519,11160,11323,11942,10625,11355,11454,12079,11555,12129,12257,12869,10848,11499,11680,12201,11841,12354,12399,13035,11890,12554,12650,13182, 12735, 13268, 13288, 13678,9822, 10337,10614,11368,10775,11448,11500,12158,10911,11687,11706,12290,11875,12355,12575,13078,10953,11847,11944,12552,12108,12654,12675,13270,12217,12832,12865,13343,13028,13490,13587,14041,11234,12070,12104,12730,12262,12834,12904,13397,12388,13034,13056,13550,13211,13588,13861,14182,12505,13179,13265,13736,13394,13741,13892,14331,13447,13992,14022,14434,14124,14518,14559,14918,4710,4369,3727,5905,4280,5747,5130,7230,4533, 5135,5267,6898,5432,6376,6165,7570,4893,5400,5593,6252,5760,6690,6476,7961,6062,6556,6760,7455,6996,8241,7754,8923,4991,5641,5823,6593,6095,6701,7017,7635,6169, 7147,6831,8636,7333,7821,8006,9917,6345,7045,7501,7875,7280,8120,8445,9435,7610,8398,8236,9016,8699,9564,9169,10678,5225,5948,6108,6925,6318,7116,7419,8020,6511,7715,7179,8165,7562,8301,8524,9210,6699,7329,7867,8439,7755,8916,8392,9303,7514,8571,8986,9466,8758,10104,9662,11372,6877,7864,7611,8709,8181,8638,9040,9537,8004,9241,8858,9848,9013,9701,10572,10300,8322,9130,9279,10155,9434,9868,10009,10810,9539,10381, 10109,11187,10517,11840,10985,12432,5542,6211,6449,7290,6636,7497,7714,8459,6827,8044,7573,8602,7823,8706,8952,9754,7012,7753,8199,8753,7965,9186,8861,9667,8304,9020,9355,9887,9247,10046,10339,10904,7216,8130,7877,8972,8526,9145,9409,9977,8444,9593,9190, 10600,9495,10142,10201,11082,8714,9352,9810,10338,9651,10407,10668,11886,9957,10770,10556,11167,10924, 11423,11556,12620,7490,8274,8653,9295,8412,9444,9697,10379,8825,9852,9526,10851,10011,10428,10651,11320,8989,9628,10047,10592,10246,10698,11062,11451,9813,10971,10802,11708,11184,11664,11948,12862,9149,10116,10353,10989,9866,10873,11111,12069,10455,11262,11437,11726,10920,12205,11893,13696,10612,11371,11540,12159, 11667,11961,12128,13061,11190,12294,12391,12729,12508,13399,12906,14439,5883,6557,6748,7717,7022,8068, 7848,8922,7120,7900,8476,9038,8212,9228,9394,10108,7418,8330,8123,9292,8521,9665,9172,10244,8776,9447,9752,10400,9546,10808,10631,11877,7594,8603,8409, 9918,9010,9412,9562,10409,8707,9648,9823,11028,10025,10559,10699,11483,9071,10107,9869,10850,10354,10671,11057,11653,10181,10970,11164,11695,11303,11922,1217 5,12692,7769,9276,8679,9703,8902,10136,9850, 10884,9173,9976, 10303, 10773, 10406, 10988, 11170, 11842,9464, 10593,10202,11433,10087,11030,11161,12131,10769,11259,11497,11926,11655,12067,12331,13177,9624,10626,10404,11189,10815,11374,11705,12261,11024,11872,11439,12154,11554,12557,12394,13039,10466,11686,11960,12455,11882,12384,12856,13032,12105,12732,12621,13338,12997,13253,13491,14554,8092,8968,9320,10105,9536,10230,10654,11222,9700,10908,10343,11369,10557,11104,11666,12259,9218,10426,10615,11552,10854,11923,11436,12203,11087,11721,11876,12510,11258,12751,12392,13860,9953,10677,10986,12038,11233,11762,11693,12688,10814,11888,12169,12450,12077,12616,12889,13267,11501,12133,11950,12651,12260,13073,12837,13393,12395,12908,13180,13549,13057,13452,13893,14181,10112,11031,11353,11887,10909,12291,11965,12728,11651,12066,12507,12866,12168,12996,13208,13672,11168,12385,12219,13027,12553,13264,13059,13604,12748,13092,13442,13545,13337,14021,13874,14334,11723,12655,12434,13251,12871,13700,13094,13839,12295,13444,13289,13890,13342,13997,14123,15029,12623,13675,13551,14210,13489,14044,14292,14652,13833,14215,14179,14773,14343,15377,14668,15477,6443,6899,7270,8161,7534,8277,8477,9398,7702,8919,8431,9756,8702,9492,9912,10650,78 66,8573,9041,9592,8829,10227,9732,10807,9229,10082,10405,11422,9981,10905,11026,11940,8018,9022,8925,98 54,9278,10045,10378,11080,9609,10597,10143,10952,10552,11185,11613,12153,9449,10424,10317,11166,10670, 11484,11322,12071,10853,11553,11720,12905,11844,12436,12330,13250,8334,9146,9548,10226,9853,10382,1097 4,11257,9353,10430,10696,11432,10558,11691,11449,12220,9818,10812,10907,11921,10624,11612,11874,12506,1 1217,11945,11685,12387,12130,12622,12835,13451,10180,10958,11352,11725,11110,12039,11927,12679,11498,1 2288,12155,12617,11920,12857,12911,13440,11061,12353,12216,12867,12511,13093,13036,13605,12107,13029,1 3212,14017,13336,13873,13740,14515,8737,9913,9490,10669,9696,11302,10599,11845,10302,10806,11083,11751 ,11020,11682,12034,12693,10176,11502,11165,12174,10957,11943,11891,12861,11438,12109,12389,12649,12263, 12998,13062,13585,10518,11235,11652,12068,11707,12454,12256,13178,11263,12202,12674,13038,12386,12909, 13271,13701,11846,12618,12453,13075,12863,13446,13214,13857,12833,13294,13590,13888,13488,14040,14120, 14803,10849,11880,11450,12433,11681,12328,12652,13254,11941,12994,12558,13183,12731,13341,13443,13894, 12106,12868,12689,13453,13074,13396,13673,14332,13030,13743,13492,14020,13702,14178,14289,14650,12218, 12695,13095,13584,12910,13606,13838,14125,13291,13996,13698,14214,13889,14295,14433,14771,13252,13858, 13998,14555,14122,14336,14438,14937,13738,14517,14654,14914,14669,14943,15108,15546,9242,10081,9849,11 133,10386,11299,11029,11967,10570,10926,11684,12504,11485,12132,12335,13031,10673,11558,11417,12200,11 889,12836,12289,13089,11843,12393,12619,13340,12694,13213,13493,14016,10975,11924,11722,12435,12076,12 556,12648,13255,11614,12678,12888,13544,13058,13449,13398,14043,12206,12891,13176,13395,13033,13591,13 703,14208,12860,13834,13586,14127,13876,14329,14342,14805,11232,11694,12258,12870,12035,12749,13079,13 547,12452,13269,12999,13450,12398,13674,13739,14213,12574,13060,13181,14019,13290,13699,13862,14558,13 445,13994,13835,14294,14047,14337,14552,14917,12733,13210,13548,13863,13339,14176,13995,14435,13679,13 891,14209,14513,14023,14769,14648,14940,13455,14126,14293,14651,14338,14800,14670,15105,14288,14665,14 915,15273,14804,15027,15277,15549,11750,12152,12352,13072,12676,13441,13037,13832,12555,13215,13209,13 895,13392,14042,13877,14519,12864,13589,13295,13872,13697,13999,14211,14512,13546,14177,14291,14649,14 121,14666,14775,15104,13026,13448,13856,14045,13607,14328,14180,14655,13737,14212,14335,14919,14516,14 671,14770,15272,13993,14437,14557,14774,14432,14941,14806,15110,14330,14913,15026,15381,14939,15276,15 379,15859,13266,13742,13875,14436,14046,14290,14556,14801,14018,14333,14514,14807,14653,15024,14936,15 279,14183,14553,14664,14942,14768,14916,15031,15473,14772,15107,15028,15378,15111,15383,15475,15862,14 339,14667,14802,15030,14912,15106,15275,15382,14938,15274,15109,15478,15376,15479,15474,15858,15025,15 278,15380,15544,15472,15545,15547,15551,15476,15548,15550,15857,15856,15863,15860,15861,520,521,522,52 7,523,832,835,1000,524,834,837,1004,904,1105,1107,1581,525,836,838,1104,907,1110,1279,1609,910,1278,1274, 1712,1441,1728,1734,2256,526,905,909,1272,911,1277,1355,1714,1005,1359,1443,1729,1576,1830,1868,2362,110 6,1445,1579,1866,1608,1947,2047,2389,1615,2049,2092,2545,2169,2646,2792,3345,833,906,1002,1358,1006,1442 ,1471,1825,1108,1580,1446,1869,1612,1951,2054,2494,1276,1578,1614,2048,1716,2089,2168,2641,1732,2171,225 8,2708,2360,2832,2931,3520,1357,1713,1730,2095,1831,2202,2338,2797,1945,2339,2388,2891,2506,2985,3089,37 05,2051,2492,2550,2991,2644,3092,3173,3830,2777,3205,3323,3951,3384,4052,4215,5031,839,1001,1007,1577,11 11,1583,1610,2053,1352,1613,1717,2094,1733,2200,2205,2794,1440,1718,1735,2203,1867,2337,2385,2894,1950,2 386,2493,2940,2640,3046,3168,3765,1464,1828,1946,2343,2040,2387,2509,3041,2093,2548,2645,3094,2776,3203, 3309,3950,2204,2686,2798,3289,2892,3353,3386,4031,2987,3492,3650,4178,3731,4276,4506,5061,1469,1948,208 8,2520,2175,2643,2711,3207,2257,2778,2835,3344,2932,3385,3519,4127,2367,2895,2941,3477,3093,3550,3709,43 14,3130,3734,3875,4442,3991,4540,4678,5463,2508,3042,3116,3654,3290,3764,3879,4495,3357,3947,4048,4660,4180,4690,4934,5712,3517,4094,4224,4825,4255,5009,5125,5865,4501,5193,5279,5824,5395,6029,6279,7154,908,1109,1273,1715,1353,1719,1826,2336,1354,1827,1870,2363,2044,2495,2521,3132,1447,1871,2045,2526,2090,2551,2684,3133,2170,2683,2793,3322,2928,3356,3472,4030,1467,2055,2172,2544,2261,2687,2799,3354,2341,2839,2933,3474,2984,3547,3690,4252,2340,2942,3044,3546,3129,3728,3767,4443,3294,3929,3992,4539,4092,4676,4830,5613,1582,2207,2262,2837,2366,2938,3043,3521,2390,3088,3114,3707,3174,3828,3933,4537,2779,3169,3291,3873,3346,3989,4089,4662,3495,4122,4230,4770,4317,4966,5148,5790,2937,3325,3475,3999,3527,4177,4250,4944,3695,4306,4418,5030,4507,5216,5322,5979,3876,4503,4541,5296,4663,5397,5222,6081,4885,5577,5713,6338,5733,6651,6791,7345,1611,2364,2384,3128,2704,3202,3308,3928,2838,3321,3347,3996,3494,4124,4229,4946,2934,3478,3526,4125,3652,4251,4345,5080,3735,4423,4494,5198,4661,5303,5459,6153,3131,3548,3689,4344,3766,4461,4621,5250,3994,4632,4688,5431,4886,5363,5687,6372,4167,4730,4960,5581,5081,5732,5811,6534,5217,5827,5826,6755,6083,6847,6971,7704,3324,3732,3930,4633,4123,4689,4829,5499,4231,4945,5011,5714,5166,5757,5825,6629,4348,5121,5272,5791,5326,5831,6137,6857,5479,6182,6275,6989,6470,7193,7342,8109,4538,5300,5425,6139,5685,6156,6426,7080,5710,6402,6560,7237,6718,7397,7646,8422,5759,6680,6837,7461,6934,7676,7554,8519,7141,7857,7944,8810,8184,8928,9167,9747,1003,1275,1356,1731,1444,1944,2046,2510,1466,2050,2091,2525,2174,2681,2685,3350,1468,2173,2206,2680,2263,2939,2988,3516,2488,2990,3119,3704,3200,3809,3931,4658,1470,2260,2365,2943,2490,3117,3170,3762,2511,3206,3310,3948,3352,4053,4164,4692,2549,3326,3389,4120,3522,4228,4277,4900,3632,4253,4433,5120,4440,5196,5301,6301,1829,2489,2507,3175,2527,3311,3351,3998,2709,3473,3512,4208,3635,4312,4422,4950,2836,3515,3688,4274,3761,4438,4457,5150,3872,4459,4492,5321,4728,5398,5571,6374,2935,3760,3826,4490,3988,4543,4657,5355,4088,4719,4843,5478,5014,5614,5715,6565,4183,4933,5084,5729,5218,5786,5997,6721,5413,6004,6202,6888,6276,7031,7210,8082,1864,2523,2682,3387,2834,3513,3651,4316,2930,3691,3763,4460,3877,4497,4509,5352,3047,3827,3985,4511,4055,4702,4827,5474,4181,4898,5012,5706,5151,5768,5955,6570,3171,3997,4163,4831,4278,4961,4951,5771,4349,5124,5194,5866,5357,6001,6045,6893,4496,5219,5409,6030,5475,6241,6278,7088,5576,6358,6515,7238,6735,7415,7669,8483,3304,4214,4307,5126,4456,5215,5359,6005,4699,5412,5530,6271,5534,6296,6465,7173,4731,5532,5575,6407,5783,6514,6686,7394,5976,6732,6835,7464,6949,7730,7906,8562,4899,5813,5928,6573,6066,6759,6846,7607,6203,6939,7091,7812,7211,7952,8147,8849,6529,7105,7253,7985,7458,8218,8291,9113,7625,8377,8517,9263,8669,9484,9693,10478,2041,2710,2890,3694,3045,3825,3949,4675,3112,3990,4095,4717,4209,4882,5063,5957,3288,4165,4315,4947,4435,5213,5161,5978,4462,5273,5394,6181,5510,6247,6336,7142,3523,4416,4463,5199,4698,5354,5426,6274,4716,5529,5569,6337,5684,6466,6533,7363,4732,5610,5752,6531,5974,6683,6819,7467,6040,6919,6948,7745,7104,7907,8053,8773,3634,4697,4701,5476,4769,5533,5705,6496,4932,5784,5917,6631,6002,6774,6936,7681,5408,5959,6080,6821,6207,7028,7107,7859,6471,7136,7312,7991,7460,8202,8263,9103,5568,6240,6406,7030,6530,7234,7370,8079,6716,7411,7522,8260,7677,8379,8560,9361,6844,7630,7780,8516,7939,8628,8772,9506,8106,8813,8893,9682,9054,9907,9940,10951,3655,4771,4881,5953,5353,5983,6044,6917,5457,6157,6267,7063,6430,7165,7361,8061,5573,6302,6517,7197,6627,7373,7525,8253,6790,7674,7481,8363,7862,8535,8668,9387,5977,6535,6682,7431,6891,7558,7747,8506,6985,7781,7938,8629,8049,8681,8869,9635,7214,7971,8142,8789,8315,8964,9093,9827,8418,9236,9338,10038,9485,10172,10218,10742,6228,6687,6974,7810,7155,7924,7974,8748,7343,8171,8222,8886,8365,8965,9267,9934,7367,8339,8508,9204,8666,9366,9371,10214,8821,9552,9623,10275,9790,10500,10623,11253,7684,8614,8630,9458,8882,9556,9684,10321,9050,9826,9872,10560,10065,10636,10983,11490,9153,10007,10131,10790,10288,10841,11116,11673,10435,11158,11248, 11850,11392,12014,12103,12656,2052,1865,1465,2929,1824,2795,2342,3878,1949,2361,2491,3648,2524,3204,309
5,4176,2201,2522,2647,3118,2796,3476,3320,4491,2986,3348,3518,4049,3706,4703,4304,5325,2259,2705,2833,33
55,2989,3493,3729,4225,3113,3829,3551,5060,3995,4417,4502,6297,3201,3733,4121,4439,3946,4656,4929,5775,4
210,4880,4700,5430,5149,5958,5535,7090,2391,2936,3040,3653,3172,3808,4029,4510,3327,4273,3831,4679,4166,
4733,5008,5574,3479,3993,4437,4901,4305,5320,4842,5711,4126,5013,5396,5812,5212,6490,6028,7856,3633,443
4,4211,5167,4691,5062,5472,5919,4500,5611,5278,6244,5427,6065,6918,6650,4824,5498,5689,6561,5774,6272,63
73,7192,5929,6733,6499,7631,6889,8314,7395,9094,2642,3115,3305,3984,3388,4093,4272,4935,3549,4536,4179,5
028,4419,5164,5356,6138,3708,4279,4693,5197,4493,5570,5297,6041,4768,5456,5753,6277,5615,6428,6713,7300,
3874,4674,4441,5362,5010,5511,5769,6355,4928,5973,5572,6938,5867,6550,6571,7482,5192,5734,6180,6712,600
3,6773,7064,8404,6339,7140,6912,7605,7360,7909,8052,9328,4054,4718,5085,5707,4884,5782,6047,6731,5223,62
64,5916,7233,6375,6834,7059,7744,5399,5996,6429,6932,6630,7108,7466,7927,6183,7389,7164,8252,7628,8108,8
518,9616,5531,6528,6719,7399,6270,7239,7543,8613,6845,7710,7921,8262,7344,8811,8423,10748,6970,7813,799
0,8749,8111,8553,8680,9903,7668,8890,9055,9457,9166,10349,9692,11935,2893,3349,3514,4275,3730,4542,4432,
5324,3824,4458,4962,5462,4696,5608,5756,6498,4028,4826,4659,5704,4967,6031,5562,6628,5214,5785,6136,675
8,5952,7172,7029,8369,4182,5029,4883,6300,5424,5770,5956,6775,5165,6000,6229,7444,6403,6915,7109,7945,54
77,6497,6273,7232,6720,7067,7459,8105,6569,7388,7582,8207,7735,8454,8775,9416,4313,5686,5127,6067,5302,6
532,6246,7252,5563,6354,6653,7143,6772,7398,7624,8316,5810,6933,6572,7917,6467,7446,7559,8683,7137,7707,
7953,8488,8107,8599,8895,9995,5982,6988,6770,7647,7199,7858,8219,8875,7414,8362,7923,8744,8048,9239,908
8,9843,6856,8170,8552,9123,8378,8978,9582,9804,8631,9478,9329,10268,9763,10091,10501,12082,4620,5358,57
28,6491,5918,6626,7062,7680,6064,7314,6717,7811,
6913,7524,8110,8871,5580,6820,6975,8030,7236,8455,7920,8
797,7523,8257,8368,9182,7706,9507,9062,10982,6303,7089,7396,8590,7683,8290,8203,9404,7198,8416,8765,911
2,8625,9286,9673,10165,7975,8685,8534,9339,8874,9923,9559,10283,9089,9694,10022,10551,9873,10474,11117,
11489,6516,7447,7763,8405,7315,8887,8561,9456,8083,8598,9159,9632,8764,9762,10060,10722,7606,8979,8823,
9789,9205,10130,9901,10662,9498,9946,10374,10537,10259,11231,11038,11730,8259,9367,9100,10079,9639,107
62,9988,10931,8891,10432,10219,11070,10274,11201,11389,12941,9333,10731,10561,11532,10485,11344,11620,
12232,10893,11563,11465,12417,11819,13389,12272,13765,3295,3649,3932,4677,4162,4729,4963,5758,4254,532
3,4887,6152,5160,5864,6284,7058,4436,5015,5473,5972,5251,6601,6082,7171,5609,6464,6771,7908,6359,7301,74
30,8490,4508,5458,5327,6266,5688,6427,6730,7480,5975,6935,6551,7366,6892,7629,8063,8733,5787,6818,6681,7
604,7066,7946,7746,8615,7235,8031,8256,9685,8336,9102,8894,10078,4828,5528,5954,6600,6265,6734,7392,770
5,5735,6836,7106,7916,6914,8185,7925,8848,6206,7196,7313,8451,6984,8062,8364,9158,7675,8509,8149,9031,86
82,9332,9557,10457,6568,7372,7762,8261,7542,8591,8489,9391,7970,8884,8745,9287,8450,9583,9715,10370,746
5,8947,8820,9633,9183,9947,9828,10663,8657,9791,10066,11211,10258,11015,10840,11993,5195,6285,5830,7065 ,6046,7734,6937,8337,6652,7170,7483,8271,7410,8146,8582,9417,6564,7984,7583,8774,7371,8507,8419,9601,792
2,8667,9051,9335,8883,9770,9906,10585,6890,7685,8104,8612,8223,9122,8868,10006,7711,8796,9370,9842,9030,
9695,10215,10763,8338,9306,9117,9927,9617,10434,10072,10945,9553,10252,10642,11066,10484,11252,11348,1
2501,7215,8376,7926,9095,8143,8892,9360,10124,8491,9746,9262,10039,9459,10273,10375,11124,8656,9634,940
5,10475,9926,10320,10723,11728,9796,10861,10502,11230,10780,11464,11579,12212,8822,9423,9989,10584,971
4,10714,10930,11393,10237,11200,10756,11562,11067,11629,11831,12413,10090,10950,11208,12083,11388,1178
0,11934,12743,10830,12007,12234,12614,12273,12855,13134,13960,5612,6431,6245,7555,6754,7731,7445,8563,6 916,7362,8148,9152,7947,8684,8929,9797,7081,8060,7863,8788,8417,9558,8885,9941,8317,9063,9307,10272,942
2,10067,10503,11210,7393,8482,8258,9101,8624,9238,9334,10125,8078,9390,9672,10536,9900,10445,10348,1133
3,8812,9683,9994,10289,9805,10643,10781,11506,9600,10900,10622,11395,11042,11643,11818,12541,7682,8206,
8870,9638,8583,9499,9935,10549,9116,10173,9771,10456,9092,10730,10831,11547,9266,9902,10023,11215,1023
6,10757,10998,12102,10433,11196,10901,11628,11347,11781,12060,12645,9479,10064,10550,10999,10269,11402 ,11197,11851,10743,11071,11507,11985,11249,12367,12142,12794,10479,11394,11621,12213,11788,12470,12350,
13017,11578,12253,12615,13185,12540,12933,13311,14053,8270,8732,8946,9922,9386,10371,9829,10892,9237,1
0073,10061,11125,10282,11332,11043,12015,9622,10637,10253,11014,10749,11209,11533,11984,10548,11403,11
595,12143,11349,12264,12427,13016,9788,10444,10944,11345,10715,11642,11488,12235,10791,11546,11731,126
57,12006,12351,12412,13184,11159,11907,12093,12426,11830,12795,12542,13164,11672,12585,12932,13499,127
65,13310,13469,14445,10164,10860,11039,11906,11346,11594,12092,12471,11214,11729,11992,12543,12233,128
96,12742,13313,11491,12061,12252,12854,12366,12644,12991,13615,12416,13043,12940,13468,13165,13583,137
21,14928,11789,12265,12500,12990,12584,13042,13273,13582,12764,13272,13135,13840,13388,13841,13720,144
44,12897,13312,13498,13850,13614,13851,13961,14219,13764,14052,14218,14349,14348,14929,14526,14527,204
2,2043,2504,2707,2505,2888,3091,3544,2546,3090,3135,3710,3306,3935,3945,4735,2547,3134,3292,3934,3359,40
50,4227,4897,3524,4226,4160,4964,4421,5144,5220,5992,2706,3307,3391,4090,3525,4213,4319,5082,3711,4351,4
489,5145,4712,5298,5410,6200,3944,4499,4715,5392,4896,5461,5583,6243,4949,5681,5772,6549,5789,6648,6816,
7645,2889,3358,3692,4350,3810,4488,4695,5249,3986,4734,4504,5411,4930,5509,5708,6356,4212,4714,4948,568
0,5086,5731,5788,6575,5162,5809,5994,6752,6158,6858,6973,7910,4347,4965,5146,5781,5299,5870,6026,6833,54
29,6027,6242,6941,6400,7083,7175,8077,5683,6352,6566,7153,6624,7194,7387,8254,6769,7429,7601,840
1,7708,8
576,8735,9713,3293,3545,3811,4713,4051,4841,4902,5691,4248,4931,5087,5780,5163,5868,5931,6822,4420,5122,
5221,5871,5393,6025,6227,6950,5508,6230,6353,7056,6574,7168,7374,8201,4622,5276,5460,6155,5560,6231,640
5,7161,5773,6562,6625,7208,6768,7413,7553,8400,5930,6722,6838,7463,6942,7687,7728,8533,7111,7808,7988,86
64,8151,8814,9114,9741,4673,5496,5730,6468,5829,6603,6757,7457,5993,6788,6865,7644,6986,7709,7905,8611,6
225,6951,7057,7779,7195,7954,8141,8854,7364,8172,8289,9000,8421,9154,9264,10127,6404,7162,7302,7998,752
0,8200,8319,9075,7695,8381,8554,9200,8670,9304,9586,10364,7883,8586,8746,9403,8795,9641,9773,10541,9105,
9831,9943,10532,10049,10751,10981,11774,3390,3987,4091,5083,4249,5123,5274,6024,4318,5275,5414,6201,557
8,6357,6469,7368,4505,5415,5579,6518,5754,6567,6714,7369,5808,6685,6817,7600,6968,7694,7760,8532,4635,57
09,5814,6548,5999,6723,6839,7692,6043,6895,6987,7776,7082,7949,8050,8792,6042,7060,7166,7948,7347,8144,8
205,9001,7526,8361,8448,9143,8584,9260,9420,10287,4840,5981,6006,6867,6224,7026,7163,7911,6268,7174,725
4,8081,7390,8250,8371,9141,6789,7375,7521,8269,7670,8407,8581,9202,7815,8596,8766,9400,8873,9636,9798,10
522,7025,7603,7777,8505,7937,8659,8790,9588,8055,8850,8910,9712,9115,9878,9986,10713,8312,9107,9155,994
4,9203,10051,9920,10783,9505,10257,10365,11012,10373,11293,11411,11905,4903,6204,6226,7346,6728,7412,75
52,8360,6894,7581,7671,8480,7814,8608,8751,9590,6990,7782,7936,8609,7996,8791,8881,9744,8173,8931,9074,9
858,9201,9971,10095,10829,7365,7950,8029,8880,8204,9049,9165,9924,8452,9180,9284,10089,9554,10037,10325 ,11048,8643,9382,9618,10271,9745,10372,10529,11182,9879,10535,10534,11391,10789,11473,11597,12244,7602,
8168,8366,9181,8597,9285,9419,10175,8767,9589,9643,10366,9824,10447,10533,11277,8888,9769,9932,10523,99
92,10539,10793,11475,10167,10868,10965,11607,11126,11799,11870,12529,9142,9968,10075,10795,10323,10842 ,11096,11640,10350,11064,11202,11827,11336,11999,12196,12792,10459,11308,11459,12043,11564,12210,12100,
12841,11743,12337,12418,13116,12586,13186,13357,13723,3693,4161,4346,5147,4498,5428,5582,6424,4

634,568 2,5755,6513,5828,6655,6715,7678,4672,5815,5980,6654,6007,7027,7138,7882,6286,7152,7341,8076,7408,8217,83 67,9198,4694,5998,6205,7061,6298,7303,7384,8186,6425,7456,7556,8382,7686,8577,8640,9330,6563,7626,7733,8 588,7918,8750,8815,9574,7968,8793,8945,9768,8976,9856,9969,11003,5277,6287,6401,7391,6519,7557,7679,850 4,6753,7761,7860,8724,7973,8852,8930,9602,6866,7881,8028,8808,8175,8966,9003,9800,8268,9029,9072,9985,93 80,10052,10235,11050,6991,8174,8248,9060,8406,9157,9197,9999,8580,9379,9477,10166,9680,10290,10367,1121 3,8687,9585,9760,10369,9904,10520,10729,11339,10063,10740,10870,11492,10966,11625,11816,12502,5360,648 9,6684,7729,6864,7861,7989,8872,6972,8051,8187,9048,8313,9091,9119,9996,7169,8249,8403,9121,8579,9368,94 07,10148,8671,9572,9674,10334,9801,10472,10621,11240,7385,8481,8627,9421,8836,9619,9603,10477,8889,9772 ,9840,10542,10005,10733,10759,11505,9090,9905,10055,10752,10149,10929,10980,11644,10256,11040,11151,11 828,11379,12021,12199,12801,7540,8734,8851,9774,9002,9877,10021,10741,9363,10062,10208,10947,10212,110 00,11115,11797,9383,10210,10255,11069,10505,11150,11328,11996,10710,11376,11457,12048,11593,12266,1236 0,12882,9573,10531,10566,11243,10766,11401,11472,12177,10871,11577,11647,12322,11817,12428,12547,13133 ,11177,11675,11849,12447,12040,12604,12659,13315,12179,12757,12823,13375,12979,13530,13687,14170,5561, 6756,6940,8054,7167,8221,8383,9207,7212,8420,8587,9377,8725,9496,9743,10639,7462,8641,8855,9591,8961,98 75,9803,10712,9052,9933,10048,10863,10188,10939,11010,11772,7919,8908,9053,9859,9362,9998,10076,10964,9 376,10191,10233,11011,10322,11118,11181,11919,9384,10284,10398,11179,10708,11311,11441,12051,10754,1154 5,11592,12277,11674,12361,12485,13081,7972,9337,9365,10150,9389,10211,10333,11142,9584,10506,10563,112 79,10734,11408,11566,12215,10054,10641,10782,11443,10895,11622,11701,12339,11127,11740,11858,12469,120 42,12600,12639,13309,10232,10928,11068,11624,11178,11824,11956,12499,11334,12013,12062,12636,12211,127 59,12880,13457,11466,12186,12302,12822,12415,12962,13080,13542,12514,13119,13169,13662,13258,13815,138 48,14491,7999,9401,9487,10587,9997,10721,10758,11535,10093,10843,10943,11631,11112,11783,11917,12487,10 239,11008,11157,11809,11255,11959,12081,12613,11410,12208,12053,12717,12348,12843,12978,13485,10711,11 183,11310,12023,11495,12140,12279,12814,11605,12303,12414,12963,12479,12985,13137,13653,11820,12431,12 544,13109,12669,13190,13275,13795,12786,13366,13430,13934,13531,14024,14048,14350,10902,11329,11598,12 320,11775,12400,12444,13018,11871,12567,12606,13158,12719,13191,13391,13842,11933,12707,12820,13364,12 976,13458,13471,14026,13129,13568,13645,14083,13784,14198,14259,14633,12230,12954,12972,13522,13146,13 570,13684,14101,13256,13794,13804,14238,13939,14264,14501,14750,13333,13931,13973,14400,14094,14409,14 584,14867,14135,14600,14626,14974,14728,15062,15083,15330,5690,5361,4623,6969,5248,6823,6154,8318,5497, 6159,6299,7986,6512,7428,7209,8658,5869,6488,6649,7340,6832,7778,7580,9061,7110,7672,7904,8555,8080,936 9,8838,9991,5995,6729,6859,7693,7139,7809,8145,8747,7213,8251,7955,9740,8453,8909,9106,11001,7409,8169,8 589,8967,8380,9196,9581,10487,8726,9486,9364,10088,9799,10640,10213,11646,6269,7024,7160,7997,7386,8216 ,8511,9120,7627,8799,8255,9265,8642,9385,9640,10254,7783,8449,8963,9575,8839,9984,9476,10351,8610,9675,1 0050,10530,9874,11140,10750,12336,7969,8960,8727,9825,9305,9742,10128,10565,9104,10285,9942,10936,1007 7,10765,11544,11292,9402,10174,10327,11203,10486,10948,11049,11798,10567,11377,11149,12187,11493,12668, 11997,13296,6602,7255,7541,8402,7732,8585,8798,9587,7951,9140,8665,9686,8911,9806,10004,10794,8140,8837 ,9331,9857,9073,10234,9945,10755,9388,10092,10399,10967,10291,11098,11331,11856,8288,9206,8977,10036,96 42,10189,10473,11037,9580,10661,10238,11576,10543,11198,11241,12054,9830,10396,10862,11330,10735,11407, 11636,12766,11013,11742,11520,12151,11916,12363,12484,13416,8578,9378,9761,10335,9504,10504,10761,1135 1,9921,10940,10562,11823,11051,11456,11627,12276,10053,10728,11099,11560,11278,11702,12050,12403,10869, 11987,11782,12612,12184,12528,12840,13622,10209,11176,11337,12005,10946,11829,12095,12953,1146

7,12254,
12373,12638,11904,13117,12793,14372,11596,12323,12468,13019,12531,12853,12984,13813,12198,13166,13259,
13521,13356,14103,13686,14987,6943,7673,7880,8809,8150,9156,8944,9990,8220,9028,9620,10126,9336,10280,10446,11148,8510,9406,9199,10332,9637,10753,10216,11276,9876,10507,10792,11400,10586,11796,11623,12741,
8686,9687,9497,11002,10074,10476,10638,11409,9807,10732,10903,12028,11065,11523,11703,12419,10151,11143,10949,11822,11338,11639,12041,12513,11229,11986,12148,12603,12275,12798,13083,13504,8853,10324,9775,
10767,9970,11180,10938,11848,10217,11036,11295,11773,11406,12004,12178,12670,10528,11561,11242,12365,11119,12030,12141,12987,11741,12247,12429,12802,12515,12943,13171,13929,10720,11606,11404,12197,11811,12338,12605,13145,12020,12716,12375,13006,12478,13373,13262,13803,11474,12566,12852,13327,12758,13232,13612,13792,12973,13528,13417,14070,13729,13965,14199,15074,9164,10020,10368,11141,10564,11254,11630,12214,10764,11868,11335,12321,11521,12080,12530,13139,10270,11442,11599,12476,11826,12799,12372,13111,12063,12629,12740,13358,12246,13543,13260,14500,11009,11645,11998,12934,12229,12658,12601,13496,11810,12784,13041,13314,12961,13400,13661,13975,12445,12989,12842,13431,13144,13821,13581,14093,13263,13692,13932,14237,13805,14168,14585,14749,11156,12031,12301,12767,11869,13159,12881,13520,12503,12942,13335,13646,13040,13728,13936,14324,12176,13233,13131,13767,13365,13972,13807,14300,13540,13912,14118,14233,14069,14625,14506,14894,12631,13459,13298,13963,13655,14388,13914,14447,13167,14132,14049,14534,14082,14605,14711,15501,13419,14327,14239,14782,14197,14692,14844,15148,14429,14819,14739,15241,14931,15653,15172,15821,7527,7987,8370,9261,8626,9381,9621,10458,8794,9987,9555,10828,9802,10540,10996,11626,8962,9681,10129,10660,9925,11251,10788,11791,10281,11114,11405,12362,11041,11857,12022,12812,9118,10094,9993,10942,10326,11097,11350,12052,10709,11565,11199,11932,11504,12185,12497,13005,10521,11440,11309,12150,11638,12424,12278,12955,11825,12477,12628,13685,12704,13308,13170,13962,9418,10190,10620,11250,10941,11378,11994,12245,10397,11458,11700,12364,11522,12587,12401,13132,10894,11808,11859,12797,11604,12496,12718,13334,12209,12821,12565,13235,12986,13418,13571,14155,11228,11958,12300,12637,12094,12935,12803,13487,12430,13156,13007,13401,12796,13613,13695,14116,12049,13189,13128,13647,13359,13913,13800,14301,12975,13785,13952,14617,14068,14505,14408,15007,9841,10997,10538,11637,10760,12274,11567,12705,11294,11790,12055,12647,12012,12546,12898,13505,11212,12446,12149,13082,11957,12815,12787,13621,12374,12977,13257,13429,13147,13730,13814,14257,11494,12231,12512,12952,12607,13326,13136,13930,12255,13110,13470,13802,13234,13693,14027,14389,12706,13402,13325,13823,13623,14134,13954,14489,13569,14054,14266,14532,14196,14632,14708,15259,11821,12756,12402,13297,12545,13168,13456,13966,12813,13722,13374,13935,13523,14081,14119,14586,12974,13652,13497,14169,13822,14100,14325,14892,13786,14411,14216,14624,14390,14738,14841,15090,13130,13507,13915,14256,13694,14302,14446,14729,14051,14604,14374,14818,14533,14847,14973,15215,13964,14490,14606,15075,14710,14920,14986,15385,14402,15061,15150,15326,15173,15427,15568,15882,10286,11113,10937,12101,11390,12267,12029,12883,11534,11918,12564,13332,12425,12988,13187,13787,11641,12486,12349,13108,12785,13580,13157,13849,12671,13261,13403,14080,13506,13953,14217,14616,11995,12800,12630,13299,12960,13372,13428,13967,12498,13486,13660,14232,13806,14153,14102,14635,13118,13663,13928,14095,13793,14267,14391,14780,13620,14430,14258,14731,14524,14865,14930,15305,12228,12602,13138,13654,12899,13541,13843,14235,13324,14025,13731,14154,13274,14326,14403,14817,13390,13812,13933,14619,14050,14375,14502,15082,14133,14602,14431,14846,14695,14921,15072,15329,13529,13938,14236,14503,14071,14736,14603,14975,14351,14535,14781,15005,14627,15213,15088,15424,14171,14730,14845,15091,14922,15256,15174,15509,14840,15161,15327,15585,15304,15447,15641,159

29,12646,13004,13188,13820,13484,14117,13801,14428,1336 7,13955,13937,14587,14092,14634,14525,15063,13644,14265,14055,14504,14373,14607,14783,15004,14234,1473 7,14843,15089,14709,15162,15243,15508,13766,14152,14488,14693,14303,14864,14748,15151,14401,14816,1489 5,15331,15060,15175,15214,15584,14601,14985,15081,15242,14972,15425,15306,15570,14866,15325,15446,1569 7,15387,15640,15655,15967,13974,14410,14507,14984,14694,14842,15080,15257,14618,14893,15006,15307,1514 9,15444,15384,15643,14751,15073,15160,15426,15212,15328,15503,15737,15240,15511,15500,15654,15571,1569 9,15739,16122,14923,15163,15258,15502,15324,15510,15587,15698,15386,15586,15569,15822,15652,15823,1573 8,15966,15445,15642,15696,15880,15736,15881,15883,15931,15820,15928,15930,15965,15964,16123,16120,1612 1,2780,2781,2782,3491,2783,3636,3639,4444,3488,3638,3813,4616,4024,4637,4639,5693,3489,3812,3814,4636,40 27,4774,5027,5717,4310,5026,4846,5912,5253,5968,6070,6868,3490,4025,4309,4844,4311,5025,5059,5914,4617,5 211,5255,5969,5564,6142,6280,7086,4638,5365,5567,6178,5716,6343,6503,7133,5779,6545,6660,7425,6725,7486, 7748,8541,3637,4026,4446,5210,4618,5254,5507,6085,4772,5692,5366,6281,5776,6371,6606,7250,5024,5566,577 8,6544,5932,6657,6724,7469,6068,6727,6870,7664,7084,7832,7943,8816,5209,5913,5970,6663,6143,6842,6946,77 65,6341,6947,7132,7887,7298,8057,8153,9025,6547,7248,7442,8075,7484,8156,8341,9178,7689,8349,8531,9311,8 644,9460,9647,10547,3815,4445,4619,5565,4775,5695,5718,6605,5056,5777,5933,6662,6069,6840,6861,7750,525 2,5934,6071,6843,6179,6945,7129,7914,6370,7130,7249,8024,7468,8138,8292,9125,5500,6140,6342,7071,6492,71 31,7317,8085,6661,7440,7485,8158,7688,8347,8513,9310,6860,7578,7766,8373,7912,8565,8646,9427,8059,8760,8 934,9570,9079,9736,10034,10577,5505,6368,6656,7336,6787,7471,7667,8351,6869,7690,7835,8540,7956,8645,87 87,9511,7095,7915,8025,8729,8157,8878,9057,9766,8282,9098,9195,9938,9347,10120,10194,11007,7316,8086,82 64,8950,8374,9124,9235,9975,8593,9283,9428,10168,9576,10198,10462,11272,8785,9482,9676,10329,971 1,10509 ,10633,11425,10017,10705,10799,11396,10899,11581,11787,12526,4308,4773,4845,5915,5057,5935,6086,6944,50 58,6087,6282,7087,6500,7251,7337,8284,5367,6283,6501,7350,6658,7443,7576,8285,6726,7539,7749,8530,7940,8 592,8720,9426,5503,6607,6784,7424,6929,7579,7767,8566,7069,7839,7957,8722,8056,8867,8982,9708,7068,8026, 8136,8866,8281,9076,9127,9939,8486,9257,9348,10071,9480,10192,10346,11193,5694,6863,6930,7837,7094,7994 ,8087,8817,7134,8152,8190,9027,8342,9176,9269,10069,7691,8293,8375,9193,8542,9345,9473,10170,8763,9502,9 690,10310,9785,10498,10656,11366,7993,8537,8723,9375,8835,9569,9706,10480,9007,9750,9862,10546,10035,10 736,10838,11515,9232,10019,10121,10824,10171,10913,10746,11617,10417,11137,11273,11814,11285,12091,122 27,12665,5719,7092,7128,8280,7640,8346,8512,9256,7838,8529,8543,9372,8762,9508,9689,10482,7958,8730,883 4,9509,8948,9707,9793,10580,9099,9899,9974,10718,10169,10835,10995,11657,8283,8876,8981,9792,9126,9961, 10133,10778,9350,10144,10196,10979,10418,10891,11227,11852,9535,10294,10492,11145,10581,11284,11383,11 982,10737,11399,11398,12167,11619,12283,12379,12944,8536,9096,9258,10145,9503,10197,10345,11055,9691,1 0481,10511,11274,10686,11305,11397,12085,9844,10617,10784,11367,10846,11415,11633,12285,11047,11678,11 779,12409,11914,12577,12662,13229,10070,10832,10961,11635,11225,11660,11898,12472,11270,11862,12000,12 609,12126,12725,12902,13466,11307,12112,12269,12777,12326,12920,12826,13519,12521,13045,13112,13718,13 284,13796,13959,14275,4447,4847,5208,5971,5364,6340,6502,7318,5502,6546,6659,7349,6786,7537,7577,8558,5 504,6785,6862,7536,6931,7995,8072,8784,7156,8074,8267,9024,8344,9137,9259,10162,5506,6928,7093,8027,715 8,8265,8294,9110,7319,8350,8514,9308,8564,9461,9532,10220,7441,8538,8661,9500,8818,9688,9737,10436,8904, 9709,9909,10616,9936,10716,10833,11805,6141,7157,7299,8343,7351,8515,8559,9374,7665,8721,8768,9604,8907 ,9764,9898,10490,7836,8771,8980,9718,9109,9930,9949,10658,9192,9951,9972,10837,10292,10914,11103,11854, 7959,9108,9162,9966,9344,10123,10161,10859,9472,10279,10363,11046,10526,11194,11275,12009,9579,10461,1 0588,11281,10738,11362,11529,12137,10933,11568,11698,12304,11784,12443,12590,13222,6176,7339,7538,8647 ,7834,8769,8935,9784,7942,8983,9111,9960,9233,10001,10057,10856,8139,9163,9341,10059,9463,10262,10331,11034,9577,10422,10524,11266,10659,11312,11471,12018,8295,9373,9531,10347,9738,10493,10491,11315,9845,10632,10706,11426,10865,11549,11589,12309,10000,10739,10917,11582,11035,11737,11786,12480,11136,11838,11971,12610,12163,12755,12913,13483,8492,9646,9751,10634,9948,10727,10867,11569,10251,10932,11078,11771 ,11090,11800,11909,12561,10295,11088,11123,11867,11343,11970,12118,12722,11512,12160,12251,12780,12369,12958,13066,13538,10423,11385,11460,12025,11602,12183,12282,12875,11699,12343,12483,13020,12591,13124,13243,13749,11977,12489,12625,13153,12774,13318,13371,13917,12877,13421,13517,14003,13633,14140,14253,14686,6493,7666,7886,9006,8137,9161,9309,10187,8188,9346,9483,10277,9605,10394,10579,11477,8372,9533,9767,10483,9911,10725,10681,11514,9962,10785,10898,11677,11074,11755,11812,12522,8819,9860,9963,10719,10250,10858,10962,11778,10276,11077,11101,11813,11224,11910,11981,12683,10304,11154,11288,11979,11510,12115,12239,12783,11584,12319,12368,12969,12488,13067,13201,13689,8906,10249,10261,11044,10309,11089,11265,11952,10460,11360,11445,12087,11550,12194,12340,12925,10916,11479,11616,12241,11715,12440,12491,13047,11915,12516,12640,13163,12776,13302,13355,13907,11100,11736,11866,12442,11978,12598,12698,13219,12124,12739,12806,13352,12921,13423,13536,14057,12280,12886,13008,13516,13107,13608,13688,14150,13226,13725,13781,14246,13870,14371,14392,14911,8951,10311,10393,11469,10857,11519,11588,12317,10993,11661,11759,12463,11902,12537,12681,13205,11121,11806,11973,12581,12059,12701,12809,13345,12226,12918,12789,13407,13050,13527,13632,14087,11513,11983,12114,12763,12307,12830,12971,13510,12405,13009,13106,13609,13197,13637,13757,14223,12594,13143,13238,13705,13379,13824,13901,14319,13462,13988,14038,14454,14141,14528,14550,14814,11732,12119,12382,13014,12527,13100,13150,13668,12663,13279,13322,13774,13409,13825,14007,14386,12687,13387,13512,13984,13630,14062,14067,14546,13733,14156,14207,14583,14298,14696,14759,15069,12928,13594,13610,14130,13770,14160,14248,14609,13866,14318,14356,14740,14469,14760,14935,15178,13945,14443,14499,14854,14596,14869,14996,15261,14663,15018,15064,15334,15132,15390,15431,15648,6604,6177,5501,7941,6084,7751,7070,9234,6369,7085,7159,8932,7348,8348,8159,9568,6841,7338,7487,8266,7764,8728,8528,9967,8058,8556,8786,9429,9026,10263,9748,10845,6871,7641,7833,8567,8073,8761,9077,9677,8189,9177,8879,10576,9351,9861,10018,11801,8345,9097,9501,9931,9282,10160,10441,11319,9606,10392,10260,10978,10657,11478,11091,12482,7135,7992,8084,8949,8340,9136,9425,10058,8539,9717,9179,10195,9534,10305,10508,11122,8731 ,9349,9929,10437,9749,10836,10362,11271,9510,10525,10912,11384,10724,11930,11580,13044,8905,9910,9607,10687,10199,10578,11032,11447,10016,11155,10798,11752,10963,11601,12318,12090,10328,11054,11245,12001,11318,11776,11853,12576,11461,12161,11955,12887,12305,13378,12723,13902,7470,8191,8493,9340,8660,9481,9716,10463,8877,10068,9571,10544,9863,10684,10864,11634,9056,9739,10221,10717,9973,11102,10825,11585,10308,10992,11289,11785,11195,11900,12121,12632,9194,10186,9937,10890,10510,11075,11313,11835,10440,11509,11120,12342,11427,11990,12019,12790,10704,11286,11676,12120,11551,12193,12464,13436,11815,12520,12312,12873,12680,13069,13200,14028,9462,10278,10589,11267,10416,11342,11591,12147,10747,11756,11444,12597 ,11855,12250,12459,12968,10915,11528,11901,12324,12086,12492,12782,13103,11679,12713,12536,13344,12884 ,13228,13518,14200,11079,11976,12127,12727,11770,12611,12819,13593,12281,12950,13097,13354,12664,13719 ,13467,14820,12378,13021,13162,13669,13231,13533,13636,14367,12912,13778,13871,14129,13958,14629,14252 ,15355,7913,8557,8770,9719,9078,10122,9908,10844,9160,9950,10494,11006,10248,11152,11304,11954,9424,10330,10163,11264,10499,11583,11094,12084,10726,11361,11632,12182,11468,12560,12441,13413,9578,10545,10395,11804,10960,11314,11476,12195,10685,11548,11733,12768,11863,12315,12493,13113,11045,11953,11777,12596,12136,12467,12775,13225,12017,12712,12846,13307,12967,13478,13691,14108,9765,11226,10635,11603,10834 ,11980,11754,12624,11095,11834,12097,12

523,12192,12726,12876,13380,11382,12325,12024,13085,11911,12770,
12831,13639,12517,12947,13125,13500,13227,13575,13783,14423,11518,12408,12190,12903,12583,13046,13319,
13763,12754,13406,13099,13664,13196,13991,13896,14347,12284,13278,13532,13927,13422,13830,14174,14312,
13611,14138,14029,14576,14279,14483,14697,15418,10132,10866,11280,11931,11446,12058,12462,12924,11600,
12642,12125,13015,12313,12808,13230,13759,11144,12240,12383,13194,12608,13479,13096,13713,12807,13349,
13412,13970,12946,14151,13882,14934,11807,12481,12724,13566,12927,13370,13303,14104,12582,13460,13681,
13916,13597,14010,14241,14521,13151,13641,13526,14039,13762,14379,14163,14591,13897,14254,14450,14735,
14357,14682,14997,15177,11972,12771,12983,13437,12643,13775,13537,14128,13223,13574,13951,14220,13680,
14278,14464,14794,12874,13831,13735,14297,13985,14498,14365,14778,14146,14398,14646,14721,14575,15055,
14962,15270,13351,14063,13904,14479,14227,14834,14416,14891,13779,14660,14551,14982,14582,15041,15129,
15729,14033,14799,14741,15192,14689,15116,15228,15468,14881,15203,15165,15553,15311,15885,15492,15985,
8487,8933,9268,10193,9530,10293,10495,11306,9710,10839,10419,11656,10680,11424,11792,12458,9928,10527,
11033,11508,10779,12045,11618,12551,11153,11908,12191,13068,11839,12633,12762,13502,10056,10994,10847,
11758,11244,11899,12146,12788,11511,12327,11991,12686,12308,12885,13207,13657,11363,12238,12113,12872,
12466,13114,12970,13595,12599,13195,13348,14249,13384,13906,13782,14478,10344,11076,11470,12044,11757,
12162,12720,12945,11287,12268,12490,13084,12314,13285,13101,13748,11714,12580,12641,13475,12404,13206,
13408,13950,12919,13513,13245,13855,13638,14032,14161,14677, 120 16, 12700, 12982, 13353, 12818, 13567, 1350 1,
14091,13142,13772,13665,14011,13474,14175,14263,14642,12781,13811,13732,14221,13971,14399,14320,14779,
13625,14299,14470,15047,14574,14959,14868,15365,10707,11793,11414,12465,11590,12966,12341,13385,12096,
12550,12791,13363,12738,13242,13558,14109,12008,13152,12847,13690,12699,13511,13463,14193,13098,13631,
13867,14035,13771,14282,14370,14753,12306,12929,13224,13592,13323,13926,13756,14442,12951,13712,14066,
14346,13854,14255,14547,14835,13386,14014,13921,14383,14201,14662,14472,14905,14157,14568,14766,14978,
14688,15068,15120,15593,12595,13420,13102,13903,13239,13780,14056,14492,13503,14274,14002,14455,14131,
14581,14647,15000,13624,14222,14105,14683,14382,14608,14795,15268,14304,14873,14698,15054,14848,15164,
15211,15460,13734,14115,14417,14752,14262,14790,14890,15133,14565,15040,14828,15202,14979,15237,15323,
15541,14482,14910,15044,15419,15128,15288,15354,15671,14862,15375,15470,15630,15493,15715,15790,16040,
11192,11903,11753,12827,12166,12959,12769,13539,12316,12682,13244,13944,13115,13640,13797,14305,12473,
13204,13051,13704,13461,14162,13773,14393,13381,13883,14015,14580,14114,14471,14699,15046,12721,13482,
13350,13905,13596,13990,14034,14493,13218,14090,14240,14720,14364,14673,14628,15101,13724,14247,14422,
14597,14313,14767,14849,15186,14192,14884,14758,15135,14966,15251,15310,15605,12926,13306,13758,14226,
13559,14147,14387,14733,13920,14529,14283,14676,13900,14798,14863,15199,14006,14366,14451,15051,14564,
14829,14946,15430,14661,15036,14885,15236,15119,15289,15412,15645,14139,14468,14734,14947,14577,15138,
15037,15335,14815,14983,15187,15361,15065,15531,15434,15686,14687,15134,15229,15461,15292,15574,15522,
15765,15210,15485,15631,15813,15604,15725,15847,16061,13362,13656,13810,14378,14086,14643,14321,14880,
13989,14473,14465,15001,14590,15100,14967,15391,14206,14761,14569,14958,14821,15045,15193,15360,14732,
15139,15219,15435,15121,15488,15559,15764,14296,14672,14904,15117,14791,15250,15176,15471,14855,15198,
15271,15649,15374,15523,15540,15812,15019,15347,15421,15558,15322,15687,15606,15804,15260,15617,15724,
15915,15677,15846,15905,16157,14520,14872,14963,15346,15118,15218,15420,15575,15050,15269,15364,15607,
15469,15720,15670,15849,15179,15413,15484,15714,15530,15644,15759,15947,15552,15771,15728,15904,15805, 15943,15977,16252,15293,15489,15592,15758,15616,15770,15837,15942,15676,15836,15791,16012,15884,16013,
15976,16156,15721,15848,15914,16018,15946,16019,16041,16103,15984,16060,16102,16133,16132,16253,16174,
16175,6494,6495,7296,7643,7297,7884,8155,8864,7426,8154,8287,9058,8494,9271,9281,10307,7427,8286,8484,9270,8595,9430,9679,10421,8832,9678,9528,10496,9897,10644,10744,11524,7642,8495,8663,9474,8833,9645,9787 ,10582,9059,9847,9965,10645,10264,10826,10918,11696,9280,10003,10267,10896,10420,11005,11147,11739,10489,11205,11316,11989,11365,12088,12236,12901,7885,8594,9004,9846,9138,9964,10223,10777,9342,10306,10032,10919,10442,11073,11268,11836,9644,10266,10488,11204,10590,11283,11364,12027,10682,11381,11526,12164,
11662,12286,12381,13070,9795,10497,10646,11341,10827,11430,11574,12249,10977,11575,11738,12345,11860,12475,12563,13217,11207,11832,12010,12525,12056,12578,12711,13346,12189,12761,12849,13433,12948,13552,13659,14261,8485,8865,9139,10265,9431,10361,10438,11247,9704,10443,10591,11340,10683,11428,11463,12242,
9896,10618,10745,11431,10897,11573,11719,12370,11072,11734,11833,12456,12026,12548,12702,13301,10134,10796,11004,11659,11092,11735,11865,12533,11317,12002,12057,12588,12188,12753,12825,13432,11462,12138,12270,12779,12346,12931,12956,13525,12495,13012,13160,13628,13247,13726,13918,14269,10185,11052,11282,11912,11413,12047,12181,12773,11525,12224,12297,12900,12406,12949,13065,13579,11717,12371,12457,13003,12579,13126,13237,13754,12684,13280,13369,13844,13465,13946,14004,14495,11864,12534,12634,13174,12804,13300,13383,13887,12939,13425,13534,13980,13634,14012,14186,14636,13055,13562,13666,14099,13711,14229,14285,14725,13909,14323,14395,14716,14457,14823,14933,15286,8662,9343,9475,10583,9705,10619,10786,11572 ,9786,10787,10934,11697,11138,11837,11913,12696,10033,10935,11139,11974,11290,12011,12122,12697,11380,12117,12237,12848,12376,12938,12980,13524,10147,11269,11386,11988,11531,12139,12271,12936,11587,12311,12407,13000,12474,13121,13198,13708,11586,12460,12538,13120,12667,13240,13305,13845,12810,13405,13472,13943,13560,14000,14112,14595,10360,11517,11570,12299,11716,12422,12535,13071,11768,12562,12626,13221,12714,13330,13415,13941,12225,12703,12805,13361,12914,13439,13557,13982,13023,13572,13682,14096,13761,14224,14306,14706,12421,12851,13001,13509,13105,13627,13706,14188,13203,13750,13790,14260,13919,14362,14414,14789,13376,13911,13947,14396,13983,14459,14376,14851,14149,14573,14637,14956,14645,15085,15147,15345,10439,11712,11718,12666,12144,12752,12824,13404,12310,12845,12915,13480,13022,13576,13671,14190,12410,13010,13104,13577,13172,13707,13769,14272,13281,13799,13886,14354,13981,14407,14487,14861,12685,13122,13193,13768,13304,13865,13957,14380,13476,13968,14008,14481,14158,14453,14613,14968,13619,14078,14202,14579,14273,14644,14713,15034,14363,14719,14718,15131,14853,15169,15221,15480,12850,13276,13410,13969,13573,14009,14111,14531,13683,14189,14231,14638,14316,14675,14717,15077,13776,14281,14384,14707,14420,14723,14857,15171,14523,14876,14925,15227,15002,15299,15342,15601,13942,14404,14475,14859,14611,14870,14988,15248,14630,14976,15042,15319,15112,15371,15452,15684,14679,15092,15159,15403,15204,15458,15428,15709,15283,15517,15554,15780,15618,15814,15869,15979,9005,9529,9794,10647,10002,10976,11146,11896,10146,11206,11291,11969,11412,12099,12123,12922,10184,11387,11516,12098,11571,12423,12518,13054,11794,12524,12661,13216,12736,13317,13411,13978,10222,11530,11713,12461,11802,12635,12708,13286,11897,12772,12828,13426,12930,13553,13616,14030,12003,12878,12965,13564,13086,13670,13727,14166,13140,13709,13809,14280,13828,14352,14405,14951,10797,11795,11861,12715,11975,12829,12923,13508,12165,12981,13048,13648,13149,13752,13798,14194,12298,13053,13192,13716,13283,13826,13847,14308,13360,13853,13884,14413,14076,14460,14563,14970,12411,13282,13328,13880,13438,13949,13977,14427,13556,14075,14137,14522,14244,14598,14639,15049,13643,14185,14276,14641,14368,14704,14797,15115,14467,14812,14878,15180,14926,15233,15308,15594,10888,11929,12116,12957,12296,13049,131

61,13760,12380,13199,13287,13864,13377,13899,13923,1442
4,12549,13329,13435,13925,13555,14064,14107,14508,13635,14164,14242,14622,14309,14680,14757,15056,1270
9,13481,13599,14113,13744,14203,14195,14685,13777,14284,14344,14726,14441,14809,14831,15185,13898,1436
9,14463,14824,14509,14889,14932,15252,14572,14964,15015,15320,15127,15393,15455,15693,12816,13658,1375
1,14286,13846,14361,14449,14813,14059,14466,14540,14907,14544,14948,14995,15297,14079,14542,14571,1498
1,14701,15014,15096,15368,14786,15124,15157,15404,15217,15490,15524,15718,14165,14715,14746,15059,1483
8,15137,15168,15441,14879,15209,15255,15514,15309,15560,15611,15789,15021,15263,15333,15567,15400,1562
4,15651,15851,15443,15673,15707,15879,15751,15926,15971,16094,11093,12180,12344,13202,12539,13321,1342
7,13987,12592,13464,13563,14073,13649,14144,14271,14763,12778,13617,13755,14191,13817,14359,14311,1478
8,13868,14385,14456,14875,14536,14899,14954,15284,13087,13788,13869,14355,14058,14426,14476,14924,1407
2,14539,14561,14955,14610,14998,15033,15351,14084,14592,14658,15023,14784,15095,15153,15407,14826,1519
7,15216,15497,15262,15525,15581,15773,13148,14037,14061,14510,14089,14543,14621,15010,14184,14702,1474
3,15079,14810,15144,15206,15463,14462,14765,14850,15155,14883,15230,15265,15519,15003,15280,15338,1557
3,15402,15620,15639,15845,14560,14888,14980,15232,15022,15316,15356,15591,15102,15389,15414,15636,1545
9,15675,15716,15901,15166,15450,15506,15706,15543,15742,15772,15934,15598,15783,15809,15962,15830,1600
7,16016,16163,13175,14097,14143,14755,14425,14793,14830,15195,14485,14871,14903,15239,14992,15291,1534
9,15583,14567,14952,15017,15301,15071,15359,15417,15629,15146,15456,15409,15665,15520,15711,15750,1590
9,14787,15035,15094,15395,15183,15432,15499,15702,15225,15507,15542,15743,15579,15753,15793,15957,1531
2,15563,15608,15777,15657,15818,15839,15995,15682,15874,15898,16030,15927,16052,16056,16134,14886,1509
7,15222,15512,15287,15536,15564,15766,15343,15615,15626,15802,15667,15819,15887,16014,15353,15663,1570
4,15872,15748,15902,15907,16054,15785,15936,15953,16071,15988,16098,16115,16201,15466,15734,15744,1592
2,15798,15938,15968,16077,15828,15994,16000,16110,16035,16116,16165,16222,15865,16027,16049,16144,1607
4,16149,16180,16243,16087,16184,16198,16258,16212,16270,16279,16318,11246,10889,10135,12377,10776,1224
3,11658,13382,11053,11663,11803,13154,11968,12760,12589,13626,11429,11928,12089,12660,12248,13002,1284
4,13881,12494,12916,13064,13535,13220,14065,13746,14419,11527,12145,12287,12937,12519,13013,13241,1366
7,12593,13331,13127,14268,13477,13789,13910,14949,12737,13277,13565,13827,13424,13976,14173,14691,1365
0,14142,14060,14480,14307,14764,14545,15254,11769,12420,12532,13173,12710,13316,13515,13924,12879,1371
5,13347,14005,13618,14085,14228,14570,13011,13473,13819,14167,13747,14412,14136,14631,13578,14243,1445
8,14714,14358,15008,14822,15516,13141,13816,13651,14317,14013,14270,14496,14745,13908,14593,14394,1489
6,14477,14837,15196,15084,14098,14530,14615,15043,14690,14908,14969,15298,14747,15125,15013,15451,1518
1,15656,15369,15840,12046,12627,12817,13434,12964,13561,13714,14187,13123,13940,13629,14250,13791,1431
4,14440,14858,13236,13745,14031,14353,13885,14562,14397,14827,14088,14484,14659,14927,14599,14990,1509
9,15336,13368,13986,13829,14452,14230,14537,14681,14961,14172,14777,14566,15208,14727,15038,15057,1541
0,14322,14656,14874,15098,14811,15143,15244,15678,14957,15282,15188,15439,15348,15527,15580,15892,1355
4,14074,14277,14623,14148,14700,14833,15123,14377,14900,14742,15315,14971,15156,15235,15496,14461,1479
6,14991,15200,15078,15266,15406,15539,14877,15363,15290,15628,15448,15600,15708,15950,14541,15020,1511
3,15373,14906,15321,15423,15733,15167,15486,15533,15638,15344,15781,15685,16136,15220,15515,15572,1576
7,15603,15713,15752,16005,15454,15806,15831,15921,15868,16079,15970,16263,12347,12917,13052,13717,1324
6,13948,13808,14418,13320,13852,14204,14494,14036,14588,14674,15012,13514,14106,13979,14620,14225,1482 5,14548,15076,14360,14703,14856,15136,14754,15296,15231,15669,13642,14251,14145,14950,14474,14684,1476 2,15145,14315,14808,14887,15396,14977,15191,15267,15555,14511,15011,14909,15314,15114,15247,15401,1559 7,15053,15362,15436,15623,15495,15690,15775,15916,13753,14612,14287,14839,14406,15032,14898,15332,1454 9,14960,15087,15285,15142,15372,15442,15658,14712,15201,15058,15529,14999,15398,15433,15755,15281,1548 3,15561,15694,15599,15731,15811,16025,14792,15226,15140,15453,15303,15518,15625,15797,15392,15664,1553 5,15762,15578,15877,15834,15999,15170,15614,15712,15855,15674,15824,15944,15992,15745,15924,15893,1606 6,15981,16045,16099,16274,13956,14448,14640,15009,14744,15070,15238,15462,14836,15340,15103,15513,1518 9,15416,15602,15795,14578,15154,15223,15576,15318,15691,15532,15779,15415,15633,15668,15870,15482,1593 5,15832,16164,14953,15253,15370,15726,15465,15650,15621,15912,15302,15680,15769,15850,15741,15888,1596 1,16051,15565,15757,15710,15899,15796,16009,15941,16073,15835,15972,16028,16109,16001,16092,16181,1622 1,15016,15399,15505,15679,15341,15803,15717,15920,15595,15730,15867,15954,15768,15980,16032,16128,1544 0,15825,15787,15987,15873,16048,16003,16124,15932,16020,16082,16105,16065,16197,16170,16246,15635,1590 3,15842,16043,15959,16140,16022,16159,15807,16084,16057,16178,16070,16189,16211,16333,15895,16131,1611 1,16226,16097,16204,16236,16284,16153,16231,16219,16301,16255,16353,16292,16365,12811,13155,13414,1400 1,13598,14077,14205,14678,13710,14415,14159,14860,14310,14724,14944,15234,13818,14245,14497,14776,1438 1,15067,14852,15295,14589,14994,15141,15526,14965,15337,15394,15700,13922,14486,14421,14902,14614,1498 9,15122,15408,14785,15205,15039,15352,15184,15449,15589,15761,14705,15152,15093,15438,15246,15556,1549 8,15735,15317,15577,15632,15969,15660,15844,15810,16042,14110,14538,14756,15066,14901,15126,15366,1548 1,14657,15158,15264,15528,15190,15619,15537,15788,14882,15300,15339,15689,15224,15588,15666,15866,1545 7,15705,15613,15827,15754,15894,15939,16091,15052,15358,15504,15637,15422,15727,15695,15911,15562,1580 0,15763,15889,15688,15945,15975,16080,15405,15817,15784,15955,15871,16021,15996,16125,15747,15989,1603 6,16193,16064,16169,16148,16267,14345,14945,14722,15245,14832,15494,15207,15661,15086,15294,15411,1564 7,15388,15610,15722,15917,15048,15566,15437,15774,15357,15703,15683,15949,15534,15749,15829,15897,1579 9,15982,16006,16113,15182,15467,15596,15732,15627,15854,15792,16026,15487,15778,15906,15998,15826,1597 3,16055,16141,15662,15890,15853,16011,15951,16086,16038,16161,15937,16062,16118,16176,16096,16200,1620 8,16307,15313,15672,15538,15841,15609,15808,15900,16046,15701,15978,15878,16031,15923,16069,16083,1618 2,15746,15956,15913,16093,16010,16076,16129,16244,15990,16151,16100,16196,16142,16218,16233,16282,1578 6,15919,16023,16112,15974,16126,16158,16213,16059,16188,16138,16230,16177,16239,16257,16299,16044,1616 2,16190,16275,16210,16248,16262,16321,16146,16269,16286,16314,16293,16327,16340,16370,14594,14993,1489 7,15429,15130,15491,15397,15719,15194,15350,15612,15864,15557,15756,15815,15991,15249,15582,15521,1577 6,15681,15940,15801,16017,15659,15833,15891,16068,15918,16037,16101,16192,15367,15692,15634,15843,1574 0,15876,15896,16047,15590,15910,15960,16104,16002,16089,16078,16203,15782,15963,16024,16075,15993,1611 9,16143,16224,15948,16154,16114,16215,16172,16241,16254,16309,15464,15622,15794,15958,15723,15933,1601 5,16107,15852,16053,15983,16090,15838,16130,16147,16229,15886,16004,16029,16195,16058,16139,16166,1627 8,16085,16186,16155,16238,16207,16249,16272,16317,15925,16034,16108,16167,16067,16216,16187,16259,1613 5,16179,16225,16265,16199,16297,16280,16324,16095,16214,16237,16283,16250,16304,16294,16337,16232,1628 9,16315,16345,16308,16331,16349,16373,15646,15760,15816,16008,15908,16081,15997,16152,15875,16039,1603 3,16183,16072,16202,16173,16271,15952,16117,16063,16168,16137,16191,16227,16264,16106,16217,16235,1628 1,16209,16290,16303,16336,15986,16088,16160,16205,16127,16240,16220,16287,16145,16228,16247,16

319,16268,16295,16298,16344,16185,16261,16277,16302,16256,16325,16310,16342,16242,16313,16330,16357,16323,16348,16355,16379,16050,16150,16171,16260,16206,16234,16276,16305,16194,16245,16266,16311,16285,16328,16320,16351,16223,16273,16288,16326,16296,16316,16335,16361,16300,16339,16332,16354,16343,16359,16363,16382,16251,16291,16306,16334,16312,16338,16347,16358,16322,16346,16341,16366,16352,16367,16362,16378,16329,16350,16356,16368,16360,16369,16371,16375,16364,16372,16374,16377,16376,16383,16380,16381]

**Sequence group 8: Q8_2048**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1026,520 ,288,528,192,544,70,44,131,81,50,73,15,320,133,52,23,134,384,76,137,82,56,27,97,39,259,84,138,145,261,29,43,98,515,88,140,30,146,1028,71,262,265,161,576,45,100,640,1025,51,148,46,75,266,273,517,104,162,53,193,1032,152,77,164,768,268,274,518,54,83,57,521,112,1024,135,78,289,194,85,276,522,58,168,139,99,86,60,280,89,290,529,524,196,141,1040,101,147,176,142,530,321,31,200,90,1056,545,292,322,532,263,149,102,105,304,296,1030,163,92,1033,47,267,385,546,324,208,386,150,153,165,106,55,328,1088,536,577,548,1034,113,154,79,269,108,578,224,166,519,552,195,270,1041,641,1036,523,275,580,291,59,169,560,114,277,156,87,1152,197,116,170,61,1042,531,525,642,281,278,526,177,293,388,1057,91,584,769,198,172,120,201,336,62,282,143,1029,1044,103,178,294,93,1058,644,202,592,323,392,297,770,107,180,1280,151,209,284,1027,648,94,204,298,400,608,1089,352,325,533,155,210,305,547,300,109,1048,184,534,1060,537,115,1090,167,225,326,306,772,157,656,329,110,117,212,171,1038,776,1064,330,1153,226,549,1043,538,387,308,216,416,271,279,158,337,550,672,1092,118,332,579,540,1072,389,173,1037,121,553,199,784,179,228,338,312,1536,704,1154,390,174,554,581,1046,393,283,122,448,353,561,1096,203,63,340,394,1049,1281,527,582,556,181,295,1059,285,232,124,205,182,643,1156,562,286,585,299,354,1045,211,401,1104,185,1061,396,344,586,645,1282,593,535,240,1050,206,95,327,564,800,402,356,307,301,417,1160,213,1066,568 ,1120,832,588,1035,1537,186,646,404,1091,227,896,594,418,302,649,771,360,539,111,1052,331,1168,214,309,1062,1284,188,449,1073,217,408,609,596,551,650,229,159,420,310,1093,541,1288,773,610,657,333,1065,119,1098,600,339,1184,218,368,652,1031,230,391,313,450,542,1538,334,1076,233,555,774,175,123,1155,658,612,341,777,220 ,314,1105,424,1068,395,673,583,355,1296,1094,287,183,234,1051,125,557,1216,660,616,342,316,1157,241,778,563,1074,345,452,397,403,1112,207,1540,674,558,785,1100,432,1039,357,187,1162,236,664,1312,624,587,780,1080,1122,705,126,242,1063,565,398,346,456,358,405,303,569,1544,244,1158,1097,595,1283,189,566,676,1169,1054,1108,361,706,589,1344,215,786,647,348,419,406,464,680,801,1069,362,1164,590,409,1286,570,1121,788,1552,1106,597,1075,572,1186,219,311,708,598,1289,601,651,421,792,802,611,1047,602,1172,410,231,688,653,1128,248,1070,369,190,364,1568,654,1095,659,1161,335,480,315,221,370,1285,613,1408,422,425,451,1077,614,543,1298,235,412,343,372,1185,775,317,1539,222,1099,426,453,237,1124,559,1170,1292,833,804,712,1082,834,661,1053,808,779,1217,617,604,1541,433,720,816,1101,1176,836,347,897,1136,243,1297,662,1600,454,318,675,1110,618,1081,898,781,1314,1220,376,428,1546,665,736,567,1107,1192,1078,840,625,238,1159,359,457,399,787,591,678,434,677,1290,1542,349,1300,1102,245,1188,458,666,1113,620,1553,1163,1313,363,127,1067,191,1125,782,407,436,626,1218,571,465,681,246,707,1346,350,1084,599,668,1548,790,1165,1320,460,1123,1200,249,682,1664,573,1171,411,803,1116,789,1304,709,365,440,628,689,374,1224,423,1556,466,793,1130,250,371,1174,481,574,1348,413,1109,603,366,1545,1287,1055,468,1570,655,900,805,615,1166,684,1409,710,1187,429,794,252,1114,373,605,1232,848,690,713,632,1316,482,806,1132,1083,427,1177,904,1569,414,1291,223,1126,1554,663,692,835,1328,619,472,1137,455,796,1189,1601,809,714,1248,721,837,716,1086,1302,1352,864,810,1173,606,1194,912,1103,722,696,377,1424,435,1293,1560,817,1129,1792,319,621,1180,812,484,1345,430,1572,1138,1299,838,667,1219,488,1111,23

9,378,45
9,622,1410,627,437,380,1201,1608,818,1178,1294,46 1,1543,496,669,1190,1317,679,1140,1079,1221,724,8 41,1305 ,629,1584,351,467,1360,438,1115,737,251,4 62,442,441,1666,469,1549,247,683,1196,1226,842,14 12,1127,738,114
4,1308,899,1602,670,1318,783,1085,849,1555,1193,8 20,1576,728,928,791,367,1376,901,1233,630,1321,68 5,844,1
204,633,711,1118,253,691,1301,824,1175,902,686,16 68,1222,1416,1133,740,1347,850,375,1558,444,1306, 470,116
7,483,1547,415,485,905,1202,795,473,1240,634,744, 1616,852,960,1322,865,693,1131,1794,1350,797,122 5,1604,1
571,906,1252,715,1141,1330,807,474,636,1179,694,2 54,1550,1665,717,1071,1315,575,913,1440,798,811,3 79,1208 ,1353,1191,697,1564,431,1142,607,1228,489 ,1324,866,723,486,1573,1181,1234,908,1793,1561,71 8,813,1364,476,
856,1117,1411,839,1329,1295,1146,725,698,1472,91 4,1249,752,868,819,1349,814,439,929,1197,1578,490 ,1139,16
80,623,1632,1336,671,1198,1362,739,1603,1557,141 3,916,1303,463,1236,843,1135,381,1672,1354,497,15 86,930,8
21,726,961,1203,1182,872,1418,492,1250,1332,631,1 574,1223,729,1145,1605,700,1796,443,1307,741,137 8,1562,1
356,1205,845,1319,920,382,1585,822,1425,851,1229, 730,1609,498,880,1256,742,445,1392,471,635,1148,1 696,932 ,1580,687,1210,1420,1612,1325,1800,903,11 34,825,1235,1361,500,1577,846,1670,1195,745,826,7 32,1264,446,962 ,1426,1620,936,1377,475,853,1310, 867,637,1551,1230,1414,907,1206,1667,1588,1333,4 87,1808,695,1441,1087,74
6,828,753,1610,854,1237,1326,857,1368,1209,504,79 9,1355,255,964,1242,909,1673,1559,1309,719,1143,4 77,1617 ,915,1448,1380,638,748,944,1728,1331,1227 ,869,1592,1428,491,699,1253,1351,754,1183,1565,85 8,1618,1417,147
6,478,968,1260,383,1212,910,1801,815,1579,976,870 ,1684,1633,917,1337,1241,1606,1824,727,1150,1442, 493,135
7,1251,1676,873,1384,701,1566,931,1323,1798,1365, 1473,756,1334,860,499,731,1648,1238,823,1575,922, 1199,16
74,874,1432,1421,918,1636,1254,502,1795,933,1366, 1338,1682,1587,1211,1488,743,1358,760,1244,1581, 881,114
7,494,1379,1272,702,921,1624,501,876,1415,847,185 6,1444,992,1697,447,1607,1436,1369,1257,1704,733, 1797,16
69,1340,1231,827,1590,934,1634,1474,882,937,963,1 419,747,1265,1119,505,1381,855,924,1810,734,829,1 563,121
3,1611,1363,1430,1258,1688,1386,965,1614,1730,12 39,938,884,506,1327,1589,1804,749,1370,1640,945,9 66,1456,
1681,755,1266,859,1427,1593,1388,940,1214,830,18 09,911,1621,1582,1832,871,639,1480,1698,1335,888, 1372,12
45,479,1422,1268,946,1732,1677,750,1802,1626,139 3,969,508,1613,861,1446,1857,1339,757,1382,970,17 00,1243,
919,1594,1433,1826,1504,875,1635,1259,862,1920,1 675,1445,758,1149,948,1359,1816,1596,1671,1712,9 77,1385,
923,1622,972,1434,1311,1729,761,1396,877,1207,14 75,1449,1812,952,1686,495,1262,1644,1619,1341,14 29,1825,
703,1371,1638,1567,1736,935,1685,978,1625,883,76 2,1246,503,1458,925,1394,1269,878,1478,735,1799,1 678,186
0,1443,1637,1481,1373,1699,1255,993,1591,1828,14 52,885,939,994,1400,1744,1656,980,1689,926,764,12 70,941,1
628,1367,1805,1457,1921,1583,1387,1642,967,1267, 1484,1450,886,831,1683,1342,1811,947,1705,1431,5 07,1261,
1840,889,1650,984,1760,1490,1615,751,1702,942,18 58,1423,1460,1383,996,1692,1641,1814,971,1477,12 73,1512,
1733,890,1598,1374,509,1806,1922,1649,949,973,13 97,1489,1708,1627,1000,1690,892,1274,1438,1817,1 390,1464 ,1868,950,1151,1731,1506,1827,1597,863,1 451,759,1864,1714,1701,1395,1803,1008,1623,1482, 1276,510,1435,16
52,979,1492,953,1928,1829,1389,1738,763,1872,974, 1453,1643,1713,1818,1215,1402,1629,1520,1830,169 1,954,1
459,1734,879,981,1505,1706,982,1924,927,1833,163 9,1447,1746,1343,1679,1820,1761,1479,1275,995,17 40,1401,
1888,765,956,1496,1861,887,1437,985,1720,997,163 0,1813,1462,1398,1645,1848,1687,1247,1716,1936,9 86,1483,
1651,1745,943,1859,1508,1834,1454,891,1841,998,1 595,1278,766,1465,1709,1764,1646,1737,511,1485,1 404,1693 ,1866,1952,1491,988,1657,1752,1807,1399, 1844,1001,951,1654,1926,1707,1391,1002,1468,1836 ,1494,1873,1271,
1694,893,1923,1461,1748,1715,975,1862,894,1815,1 497,1653,1510,1762,1842,1375,1703,1009,1466,1874 ,955,173
9,1486,1930,1889,1004,1658,1821,1718,1929,1599,1 507,1776,1405,1735,1831,1493,1010,1984,1455,957, 1865,983 ,1710,958,1514,1876,1768,1721,1938,1660, 1500,1403,1892,1819,1741,1516,987,1932,1463,1012 ,1843,1749,999,1
838,1277,1647,1925,1498,1742,1513,1880,1717,1016 ,1953,1837,1867,1631,1469,1747,767,1904,1724,152 4,989,14
06,1754,1822,1835,1499,1944,1863,1890,1467,1003, 1522,1763,1695,1850,990,1005,1937,1722,1845,1495 ,1655,17 65,1956,1487,1750,1869,1521,959,1896,1263,1940,1770,1877,1509,1711,1756,1846,1011,1960,1784,1870,1662,10
13,1985,1753,1927,1528,1849,1882,1766,1511,1954,1719,1777,895,1439,1006,1878,1891,1939,1661,1502,1986,18
52,1934,1723,1772,1515,1897,1014,1470,1743,1931,1017,1968,1881,1894,1769,1517,1778,1941,1823,1659,1992,1
875,1755,1501,1018,1900,1725,991,1933,1839,1525,1955,1988,1884,1726,1948,1780,1518,1020,1767,1905,1851,1
893,1945,1757,1530,1958,1471,1007,2000,1847,1898,1523,1942,1961,1871,1771,1529,1912,1758,1989,1946,1526,
1906,1883,1773,1957,1853,1976,1015,1751,1993,1503,1962,1781,1885,1908,2016,1854,1532,1972,1774,1019,189
5,1987,1969,1782,1279,1943,1899,1994,1663,1964,1785,1021,1935,1886,2001,1407,1779,1990,1970,1879,1022,19
02,1947,1759,1907,1527,1996,1786,1959,2002,1913,1949,2017,1534,1788,1910,1965,2004,1901,1966,1775,2008,1
531,1971,1950,1909,1991,2018,1727,1916,1855,1974,1995,2020,1977,1787,1914,2005,1887,1023,1963,1998,1783,
2024,1980,1903,1973,2003,1789,1997,2032,1978,1917,2010,1519,2019,2006,1951,1911,2021,2009,1790,2026,197
5,2012,1967,1915,2025,2022,1981,1918,2033,1999,2028,1533,2011,1982,2034,1979,2023,2013,2036,2007,2030,20
14,2040,1535,2027,2029,2035,2037,1791,2038,2041,1919,2042,2039,2044,2043,2031,1983,2046,2047,2015,2045]

**Sequence group 8: Z8_2048**

[0,1,2,7,3,8,11,24,4,10,13,28,16,33,35,77,5,12,14,32,19,38,47,81,22,46,42,88,57,96,102,166,6,17,21,40,
23,45,51,90,29,55,59,97,72,110,116,184,34,61,75,114,80,123,133,195,87,135,146,221,151,232,252,363,9,18,26,54,
30,58,71,105,36,76,62,117,84,127,140,204,44,74,86,134,92,143,150,227,100,153,168,244,182,260,277,402,53,89,9
8,149,111,160,176,257,121,177,194,269,206,291,307,433,137,202,224,297,230,308,331,462,249,339,357,483,376,5
04,541,725,15,25,31,73,39,79,82,139,48,85,93,148,101,158,163,254,56,94,103,161,115,175,191,272,126,192,203,2
86,226,304,326,451,64,108,122,181,128,193,209,299,147,222,231,310,248,337,351,482,162,240,258,343,270,371,3
78,501,293,390,420,530,441,558,614,727,69,124,142,212,157,229,247,341,167,250,263,362,278,377,401,521,189,2
73,287,387,309,412,437,568,322,444,467,592,489,624,644,819,208,300,316,424,344,450,471,607,375,479,502,636,
532,648,700,874,399,512,542,675,553,715,737,915,611,751,773,908,799,951,1005,1192,20,37,41,91,49,95,106,174 ,50,107,118,185,130,205,213,324,63,119,131,218,144,225,238,325,152,237,253,356,274,374,382,500,67,141,154,2
20,171,241,259,372,179,267,279,384,290,409,428,550,178,288,302,408,321,438,453,593,346,473,490,623,510,642,
680,859,78,165,172,265,188,284,301,403,196,306,314,435,332,460,477,621,251,327,345,465,364,487,509,638,393,
516,546,672,571,712,740,902,283,359,385,497,407,529,548,702,431,564,578,724,615,762,782,939,468,613,625,77
4,639,801,766,965,689,851,875,1016,881,1081,1115,1229,83,186,190,320,242,336,350,472,266,355,365,494,392,5
18,545,704,280,388,406,519,422,549,573,730,445,581,606,756,637,779,817,973,323,410,427,572,452,599,629,768,
492,630,646,813,690,797,865,1022,527,666,708,853,731,880,905,1058,763,911,910,1105,967,1127,1155,1308,358,
442,474,631,517,647,679,829,547,703,717,876,748,887,909,1077,574,735,770,903,786,913,969,1129,827,978,1001 ,1161,1040,1201,1226,1385,622,776,809,971,863,974,1030,1174,872,1026,1062,1215,1094,1247,1294,1444,889,10
84,1123,1263,1146,1300,1278,1463,1189,1331,1352,1516,1396,1544,1581,1667,27,43,52,99,60,120,132,210,66,13
6,145,217,156,235,239,368,68,155,164,234,173,285,294,398,198,296,319,432,334,455,475,634,70,170,187,289,200 ,317,328,448,211,340,352,480,370,505,524,650,223,360,381,514,404,544,559,694,414,551,583,734,590,754,777,10
11,109,199,207,333,219,353,369,496,245,383,394,536,417,566,580,706,264,397,426,556,447,588,595,742,464,597,
604,781,664,802,845,1024,281,446,458,602,486,627,633,791,508,663,683,826,720,860,877,1065,535,699,732,879,
764,900,943,1097,807,948,980,1130,1002,1165,1206,1378,112,215,236,379,262,395,421,570,276,429,449,598,469,
609,617,788,305,459,485,619,507,658,677,822,533,692,718,870,743,890,927,1068,329,495,523,681,560,709,707,8
93,575,736,752,916,793,945,957,1135,608,765,805,952,823,987,1004,1176,850,1020,1049,1216,1103,1253,1297,1
451,348,540,565,738,594,761,795,949,655,806,834,997,838,1008,1037,1199,667,836,849,1029,897,1048,1

088,124 4,936,1100,1121,1264,1153,1314,1336,1470,693,907, 922,1071,962,1107,1126,1287,981,1151,1179,1328,1 207,1356 ,1391,1525,1053,1181,1219,1363,1260,140 2,1419,1571,1289,1435,1461,1591,1493,1628,1661,1 772,129,246,268,4 30,303,457,481,641,312,488,513,661,537,686,729,92 9,342,525,569,705,585,759,745,938,600,771,798,977, 830,991, 1014,1190,405,576,601,757,654,790,810,1000,660,83 3,843,1015,862,1038,1057,1233,668,856,884,1055,93 4,1087, 1117,1267,954,1143,1152,1319,1180,1337,1371,1509 ,416,653,657,824,671,837,869,1044,698,898,919,107 9,946,11 12,1148,1303,804,931,964,1119,983,1162,1183,1333, 1041,1186,1222,1365,1262,1398,1415,1569,842,986, 1028,116 4,1054,1212,1236,1377,1092,1251,1272,1412,1301,1 437,1468,1607,1124,1292,1324,1460,1351,1484,1508 ,1632,13 82,1519,1541,1656,1556,1693,1700,1831,425,673,68 5,925,789,941,956,1141,815,975,995,1169,1034,1195 ,1231,13 73,847,1012,1051,1203,1075,1239,1275,1407,1114,1 298,1269,1429,1334,1465,1492,1613,937,1059,1086, 1255,113 3,1280,1321,1456,1159,1325,1350,1485,1369,1495,1 527,1651,1208,1359,1388,1513,1421,1548,1563,1681 ,1442,15 86,1604,1712,1629,1732,1736,1804,984,1089,1156,1 326,1193,1346,1360,1504,1227,1395,1404,1536,1431 ,1549,15 93,1698,1235,1427,1458,1584,1490,1608,1611,1734, 1521,1634,1647,1749,1674,1776,1791,1867,1306,148 0,1486,1 624,1532,1636,1658,1755,1554,1680,1686,1786,1717 ,1792,1833,1888,1577,1709,1729,1814,1752,1819,18 46,1909, 1765,1850,1864,1922,1878,1934,1943,1982,138,113, 65,275,104,255,180,470,125,183,201,418,216,338,31 1,528,15 9,214,233,318,256,386,354,603,292,366,400,503,434, 659,562,785,169,243,261,373,295,391,439,543,313,4 61,413,7 26,493,577,612,1009,335,443,515,589,478,632,697,8 95,538,684,656,812,741,930,839,1178,197,282,298,4 23,330,4 54,499,618,361,555,463,645,526,669,714,848,389,49 1,587,695,563,780,682,873,520,719,800,906,758,104 2,950,13 30,415,584,539,749,649,728,820,921,610,857,772,98 8,811,961,1142,1080,674,828,867,1063,894,998,1023 ,1200,92 3,1101,1047,1293,1131,1420,1245,1564,228,315,349, 484,380,511,554,701,411,620,531,722,579,746,792,9 70,436,5 61,651,755,605,844,775,955,670,814,885,1003,861,1 032,1091,1220,466,640,591,796,716,831,891,1019,69 6,933,84 6,1150,917,1060,1069,1270,750,882,976,1090,947,11 11,1170,1438,1017,1188,1136,1285,1230,1339,1370, 1598,506 ,662,733,871,688,896,959,1099,767,992,91 8,1211,1025,1120,1167,1318,803,942,1033,1144,107 8,1184,1266,1349, 979,1241,1194,1406,1290,1384,1462,1644,835,1052, 1095,1249,996,1217,1277,1479,1125,1312,1343,1414 ,1228,15 17,1445,1806,1154,1329,1364,1505,1387,1467,1494, 1691,1296,1538,1557,1623,1580,1757,1660,1927,271 ,367,396 ,557,440,626,582,784,456,596,710,818,652, 854,886,1046,498,676,635,868,713,953,840,1076,760 ,899,968,1106,92 4,1198,1163,1433,534,723,687,1010,808,892,928,111 3,747,944,985,1256,1027,1139,1185,1353,825,1045,9 99,1210 ,1096,1173,1261,1381,1067,1240,1282,1401, 1317,1448,1511,1618,567,864,739,963,778,1056,990, 1218,841,1018,1 083,1191,1110,1248,1288,1422,904,1145,1070,1341, 1039,1258,1281,1497,1187,1311,1357,1452,1383,147 7,1543,1 707,940,1160,1108,1295,1205,1332,1403,1531,1252, 1428,1345,1502,1368,1589,1560,1685,1128,1394,146 6,1575,1 436,1550,1640,1678,1487,1626,1599,1744,1669,1725 ,1777,1938,628,794,878,1043,920,1074,1168,1302,96 0,1224, 1093,1327,1137,1274,1386,1529,852,1118,1157,1366 ,1214,1449,1342,1515,1273,1409,1432,1582,1310,16 33,1558, 1832,1013,1177,1246,1474,1305,1418,1399,1616,120 4,1440,1507,1570,1483,1594,1655,1731,1361,1499,1 464,160 5,1530,1695,1639,1751,1561,1662,1710,1785,1687,1 770,1847,1887,1050,1259,1323,1439,1225,1537,1469 ,1622,13 79,1476,1579,1648,1506,1668,1714,1800,1286,1551, 1523,1673,1585,1728,1689,1796,1630,1702,1760,178 1,1743,1 863,1838,1912,1411,1609,1566,1723,1653,1810,1704 ,1827,1539,1762,1737,1844,1748,1855,1877,1997,16 01,1803, 1787,1892,1775,1870,1902,1948,1823,1897,1885,196 5,1919,2017,1956,2029,347,419,476,643,522,665,711 ,888,55 2,783,691,972,744,914,1006,1166,586,721,821,932,7 69,1073,966,1197,855,1036,1109,1338,1021,1221,12 54,1454, 616,816,787,994,866,1031,1098,1268,935,1147,1061, 1234,1134,1291,1375,1501,901,1116,1085,1284,1172 ,1354,1 320,1481,1213,1367,1408,1659,1424,1568,1542,1722 ,678,832,926,1072,993,1102,1242,1309,883,1122,118 2,1340, 1138,1397,1347,1524,982,1202,1223,1447,1158,1374 ,1430,1578,1299,1459,1393,1553,1496,1600,1637,17

69,1066,
1238,1322,1413,1276,1475,1453,1615,1358,1534,150 3,1595,1446,1641,1665,1758,1265,1547,1520,1649,1 583,170
3,1682,1797,1489,1675,1718,1859,1742,1837,1818,1 931,753,1007,912,1171,958,1316,1149,1425,1082,11 96,1271,
1417,1250,1390,1472,1619,1064,1362,1283,1510,123 7,1457,1443,1643,1344,1491,1555,1603,1533,1670,1 692,178
9,1132,1307,1380,1478,1405,1574,1526,1708,1313,1 514,1610,1684,1552,1663,1735,1811,1426,1596,1573 ,1697,16
45,1764,1720,1829,1635,1740,1794,1842,1774,1866, 1874,1971,1209,1434,1348,1565,1389,1540,1606,172 6,1455,1
666,1590,1713,1625,1747,1761,1848,1488,1650,1617 ,1771,1696,1754,1801,1910,1676,1821,1778,1862,18 12,1884,
1899,1946,1522,1621,1705,1788,1664,1798,1826,187 9,1739,1854,1808,1896,1843,1905,1921,1963,1724,1 830,185
6,1939,1876,1914,1926,1985,1816,1933,1950,1978,1 957,1991,2004,2034,858,1035,989,1279,1104,1315,1 257,1471 ,1140,1232,1392,1576,1355,1498,1545,167 7,1175,1372,1335,1512,1441,1638,1535,1701,1423,1 559,1597,1746,162
0,1719,1779,1858,1243,1450,1410,1567,1482,1588,1 602,1727,1376,1614,1654,1780,1688,1767,1756,1869 ,1518,16
57,1706,1753,1679,1795,1813,1890,1642,1824,1790, 1881,1840,1907,1918,1973,1304,1400,1528,1652,147 3,1631,1
699,1783,1572,1733,1671,1768,1562,1802,1817,1895 ,1592,1690,1711,1861,1738,1809,1834,1942,1763,18 52,1825,
1904,1873,1915,1936,1981,1627,1716,1784,1835,174 5,1882,1853,1923,1805,1845,1891,1929,1865,1961,1 944,198
8,1773,1880,1903,1947,1916,1968,1958,2001,1898,1 953,1979,2009,1972,1995,2013,2037,1416,1500,1546 ,1694,16
12,1759,1683,1822,1587,1721,1715,1849,1750,1868, 1841,1935,1646,1793,1741,1836,1807,1857,1893,192 8,1782,1
883,1901,1945,1875,1954,1967,2000,1672,1766,1828 ,1871,1799,1906,1886,1951,1815,1894,1913,1983,19 32,1959,
1962,2008,1851,1925,1941,1966,1920,1989,1974,200 6,1908,1977,1994,2021,1987,2012,2019,2043,1730,1 820,183
9,1924,1872,1900,1940,1969,1860,1911,1930,1975,1 949,1992,1984,2015,1889,1937,1952,1990,1960,1980 ,1999,20
25,1964,2003,1996,2018,2007,2023,2027,2046,1917, 1955,1970,1998,1976,2002,2011,2022,1986,2010,200 5,2030,2
016,2031,2026,2042,1993,2014,2020,2032,2024,2033 ,2035,2039,2028,2036,2038,2041,2040,2047,2044,20 45]

**Sequence group 8: Q8_4096**

[0,1,2,4,8,16,32,3,5,64,9,6,17,10,18,128,12,3 3,65,20,256,34,24,36,7,129,66,512,11,40,68,130,19,1 3,48,1
4,72,257,21,132,35,258,26,513,80,37,25,22,136,260,2 64,38,514,96,67,41,144,28,69,42,516,49,74,272,160,1 026,520 ,288,528,192,544,70,44,131,81,50,73,15,320, 133,52,23,134,384,76,137,82,56,27,97,39,259,84,138, 145,261,29,43,9
8,515,88,140,30,146,1028,71,262,265,161,576,45,100 ,640,1025,51,148,46,75,266,273,517,104,162,53,193, 1032,15
2,77,164,768,2048,2049,268,274,518,54,83,57,521,11 2,1024,135,78,289,194,85,276,522,58,168,139,99,86, 60,280,8
9,290,529,524,196,141,1040,101,147,176,142,530,32 1,31,200,90,1056,545,292,322,532,263,149,102,105,3 04,296,1
030,163,92,1033,47,267,385,546,324,208,386,150,15 3,165,106,55,328,1088,536,577,548,1034,113,154,79, 269,205
0,2052,108,578,224,166,519,552,195,270,1041,641,1 036,523,275,580,291,59,2056,2064,169,560,114,277, 156,87,1
152,197,116,170,61,1042,531,525,642,281,278,526,1 77,293,388,1057,2080,2051,91,584,769,198,172,120, 201,336,
62,282,143,1029,1044,103,178,294,93,1058,644,202, 592,323,392,297,2053,2112,770,107,180,1280,151,20 9,284,10
27,648,94,204,298,400,608,1089,352,325,533,155,21 0,305,547,300,109,1048,184,534,1060,537,115,1090, 167,225,
326,306,772,157,656,329,110,2057,2054,117,212,171 ,1038,776,1064,330,1153,226,549,1043,538,387,308, 216,416,
271,279,2065,2058,158,337,550,672,1092,118,332,57 9,540,1072,389,173,1037,121,553,199,784,179,228,3 38,2066,
2176,312,1536,704,1154,2060,2081,390,174,554,581, 1046,393,283,122,448,353,561,1096,203,63,340,394, 1049,12
81,527,582,556,181,295,1059,285,232,2113,2068,124 ,205,182,643,1156,562,2304,2082,286,585,299,354,1 045,211,
401,1104,185,1061,396,344,586,645,1282,593,535,24 0,1050,206,95,327,564,800,2072,2084,402,356,2055, 2177,30
7,301,417,1160,213,1066,568,1120,832,588,1035,153 7,186,646,404,1091,227,896,594,418,302,649,2114,2 560,771,
360,539,111,1052,331,1168,214,2059,2088,309,1062, 1284,188,449,1073,217,408,609,596,551,650,229,159 ,420,31 0,1093,541,2116,2178,1288,773,610,657,333,1065,11
9,1098,600,339,1184,218,368,652,1031,230,391,313,
450,542,
1538,334,2067,2061,2096,2062,1076,233,555,774,17
5,123,1155,658,2120,2305,612,341,777,220,314,1105
,424,106
8,395,673,583,355,1296,1094,287,183,234,1051,2069
,2180,125,557,1216,660,616,342,2083,2306,316,1157
,241,77
8,563,1074,345,452,397,403,1112,207,2074,2561,154
0,674,558,785,1100,432,1039,357,187,1162,236,664,
1312,62
4,587,780,1080,1122,2128,2085,705,126,242,1063,20
73,2070,565,398,346,456,2184,2308,358,405,303,569
,1544,2
44,1158,1097,595,1283,189,566,676,1169,1054,1108,
361,706,589,1344,215,786,647,348,2312,2086,419,40
6,2562,
2144,464,680,2115,2089,801,1069,362,1164,2192,20
76,590,409,1286,570,1121,788,1552,1106,597,1075,5
72,1186,
219,311,708,598,1289,601,651,421,792,802,2117,209
0,611,1047,602,1172,410,231,688,653,2564,2097,112
8,248,1
070,369,2122,2320,190,364,1568,654,1095,659,1161,
335,480,315,221,370,1285,613,1408,422,2208,3074,4
25,451,
2568,2336,1077,614,543,1298,235,412,343,372,2576,
2240,1185,775,317,1539,222,1099,426,453,237,1124,
559,117
0,2592,2118,1292,833,804,712,1082,834,661,1053,20
92,2179,2129,2098,808,779,1217,617,604,1541,433,7
20,816,
1101,2121,2063,1176,836,347,897,1136,243,1297,66
2,1600,454,318,675,2368,2181,1110,618,1081,898,78
1,1314,1
220,376,428,1546,2100,2071,665,736,567,1107,2182,
2432,1192,1078,2124,2185,840,625,238,1159,359,45
7,399,78
7,2130,2104,591,678,434,677,1290,1542,2075,2145,3
49,1300,1102,245,1188,458,666,1113,620,1553,1163,
1313,36
3,127,1067,191,1125,782,407,436,2087,2307,626,121
8,2132,2186,571,465,2193,2309,681,246,707,1346,20
77,2091 ,2146,2563,350,1084,599,668,1548,790,2136
,2188,1165,1320,460,1123,1200,249,682,1664,573,11
71,411,803,1116 ,789,1304,709,365,440,628,689,207
8,2194,374,1224,3076,2119,423,1556,466,793,2310,2
313,2209,2624,1130,250,
371,1174,2093,2148,481,574,1348,413,1109,603,366,
1545,1287,1055,468,1570,655,900,805,615,1166,684,
1409,71
0,2688,3073,1187,429,2099,2196,794,252,1114,373,6
05,1232,848,690,2094,2123,713,632,2314,2321,1316,
482,806 ,1132,2565,2152,1083,427,1177,904,1569,41
4,2210,2101,1291,223,1126,1554,663,692,835,1328,6
19,472,2241,308
0,1137,455,2200,2125,796,1189,1601,809,714,1248,7
21,837,716,1086,2212,2816,1302,1352,864,810,1173,
606,119
4,912,1103,722,696,377,2316,2322,1424,435,2566,21
02,1293,1560,817,1129,1792,319,621,1180,2131,210
5,2569,2
160,812,484,1345,430,1572,1138,3072,2183,1299,83
8,667,1219,2126,2337,488,1111,239,378,459,622,141
0,627,22
42,2133,437,380,1201,1608,818,1178,2324,2570,129
4,461,1543,496,669,1190,1317,679,2106,2216,1140,1
079,218
7,2147,1221,724,841,1305,629,1584,2134,2108,351,4
67,2328,2137,1360,438,1115,737,2338,2577,251,462,
442,441 ,2572,2244,1666,469,1549,247,683,1196,218
9,3088,2149,2195,1226,842,1412,1127,738,1144,222
4,2190,1308,899,
1602,670,1318,783,1085,849,1555,1193,820,1576,72
8,928,791,367,2578,2369,1376,901,2079,2248,2138,3
104,123
3,630,2593,2340,1321,685,844,1204,633,711,2370,25
80,2311,2197,2150,2153,1118,253,691,1301,824,117
5,2352,2
344,902,686,1668,1222,1416,1133,740,1347,850,375,
1558,444,1306,470,1167,483,1547,415,3078,2211,48
5,905,21
40,3081,1202,795,473,1240,2095,2315,634,744,2433,
2594,1616,852,2372,2256,2434,2198,960,1322,2201,
2213,86
5,693,2154,2103,1131,1794,1350,797,1225,1604,157
1,906,2376,3136,1252,715,1141,1330,807,474,636,11
79,694,2
54,1550,1665,2584,2625,717,1071,2596,3082,1315,5
75,913,1440,798,811,379,1208,2161,2202,1353,1191,
2127,23
17,697,1564,431,1142,607,1228,2156,2626,489,1324,
2272,2214,866,723,2567,2600,486,1573,1181,1234,9
08,1793,
1561,718,813,1364,2243,2318,476,856,3089,2689,11
17,1411,839,1329,1295,1146,3084,2571,725,698,147
2,914,23
23,2628,1249,752,868,819,1349,814,439,929,2339,21
07,1197,1578,490,1139,2217,2608,1680,623,2162,23
25,1632,
1336,671,1198,1362,739,2204,2135,1603,1557,3200,
2245,2164,2218,1413,916,1303,463,1236,843,2109,3
090,1135 ,381,1672,1354,2579,2573,497,1586,930,82
1,2690,2329,726,961,1203,1182,2326,2574,872,1418,
492,1250,1332,63
1,2225,2341,2436,3105,1574,1223,729,1145,1605,70
0,2139,2632,1796,443,2817,2246,1307,741,2220,216
8,1378,1
562,1356,1205,845,1319,2249,2384,920,382,2110,23
30,1585,822,1425,851,2191,3077,3092,2151,1229,73
0,1609,4
98,2226,2342,880,1256,742,445,1392,471,2141,3106,
2692,2250,2640,2371,635,1148,1696,932,1580,687,2
440,234
5,1210,1420,1612,1325,1800,903,1134,825,1235,136

1,500,1577,846,1670,1195,745,2818,2155,2228,3328,826,732,
2199,2257,2332,3075,1264,446,2696,2142,962,1426,1620,936,2252,2346,1377,475,2448,2656,3137,2400,2373,258
1,853,1310,867,637,2203,2258,1551,1230,2353,2595,1414,907,1206,1667,1588,1333,487,1808,2348,2157,695,144
1,1087,746,828,753,1610,854,1237,1326,3096,2232,857,1368,2582,3108,1209,504,799,1355,2585,2163,255,964,31
38,2215,2273,2374,1242,909,2354,2820,2205,2704,1673,1559,1309,719,2377,2158,1143,477,2165,2260,1617,915,
1448,1380,2219,3086,638,748,2824,3112,944,1728,1331,1227,869,1592,1428,491,699,1253,1351,754,2378,3201,1
183,1565,2274,2597,858,1618,1417,1476,3091,2586,478,968,1260,383,2435,2356,1212,910,1801,815,2264,2464,1
579,976,2319,2327,870,1684,1633,917,2206,2385,2598,2720,3140,2166,1337,1241,2380,2627,1606,1824,727,1150 ,1442,493,1357,1251,2588,3120,1676,873,2437,2221,1384,701,3085,2169,1566,931,1323,1798,1365,1473,2601,22
47,756,1334,860,499,2832,2227,731,1648,1238,823,1575,922,1199,1674,2276,2386,874,1432,1421,918,2360,3584,
2752,3202,1636,1254,2438,2222,502,1795,2602,2629,933,1366,3094,2441,1338,1682,2331,2170,2496,2401,1587,1
211,1488,743,1358,760,2609,3144,1244,1581,881,1147,2251,2111,494,1379,1272,702,2388,2442,3097,3329,921,1
624,501,876,2575,2630,1415,847,1856,1444,992,1697,2604,2229,2343,3107,2333,2280,447,1607,1436,1369,2172,
2253,1257,1704,2230,2691,733,1797,3204,2610,1669,1340,1231,827,1590,934,2334,2633,1634,1474,2347,2402,30
93,2259,882,937,2449,3152,2233,3109,963,1419,747,1265,2444,2392,1119,505,1381,855,2634,2693,924,1810,333
0,2641,2583,2288,3098,2254,734,829,1563,1213,2143,2375,1611,1363,2612,2848,1430,1258,1688,1386,965,1614,
1730,1239,2450,2404,938,884,506,1327,1589,1804,2355,2349,2465,3208,749,1370,2261,3114,2616,3168,1640,945 ,2880,2636,966,1456,1681,755,3083,3585,2234,2694,1266,859,2452,3139,2275,2944,2642,2466,1427,1593,1388,9
40,2350,2697,1214,830,2819,2408,1809,911,1621,1582,2587,2159,1832,871,3100,2379,639,1480,1698,1335,888,1
372,1245,479,1422,1268,3216,2262,946,1732,2357,3110,1677,750,1802,1626,3332,2236,2497,3121,1393,969,2265 ,2456,2657,2644,508,1613,2599,2698,2277,2207,861,1446,2468,2358,1857,1339,3141,2589,757,
1382,3336,2821,9
70,1700,2658,2705,2381,3113,1243,919,2167,3146,1594,1433,1826,1504,875,1635,1259,862,2648,2387,1920,1675 ,3232,2266,1445,758,2416,2700,1149,948,1359,1816,3079,2278,1596,1671,1712,977,2439,2361,1385,923,1622,97
2,2498,2590,1434,1311,3586,2382,1729,761,1396,877,3124,2281,2603,2822,2223,2171,3203,2706,1207,1475,2660 ,2389,1449,1812,952,1686,2825,2268,495,1262,2362,3153,1644,1619,2472,3116,1341,1429,2443,2721,1825,703,1
371,1638,1567,1736,2631,2403,935,1685,978,1625,3344,3142,883,762,1246,503,2335,2231,1458,925,1394,1269,2
282,3099,878,1478,735,1799,2173,2605,3264,2708,2664,2390,1678,1860,2364,3205,2289,2826,2611,3122,1443,16
37,2393,2500,1481,1373,2445,2451,3160,2255,1699,1255,993,1591,1828,1452,3588,2722,885,939,994,1400,2606,
2833,3148,2480,1744,1656,3087,2405,2235,3210,980,1689,926,764,2284,2712,1270,941,1628,1367,1805,1457,336
0,2672,2635,2828,3128,3170,1921,1583,2753,2174,1387,1642,2290,3111,967,1267,2613,2446,1484,1450,2394,250
4,886,831,1683,1342,1811,947,2406,2453,2351,2617,3592,2292,1705,1431,3206,3145,2643,3331,507,1261,1840,8
89,2237,2614,1650,984,1760,1490,2724,3217,3102,3156,1615,751,2409,2754,2637,3392,2263,2834,1702,942,1858 ,1423,2695,2396,1460,1383,2467,2454,996,1692,1641,1814,971,1477,2512,2728,1273,1512,1733,890,1598,1374,2
849,3117,2410,3212,509,1806,2638,2457,3334,2618,1922,1649,3169,2836,3600,3154,949,973,2645,3123,2620,323
4,1397,1489,2267,2359,2756,2646,3337,2649,1708,1627,2699,2469,1000,1690,2840,2850,892,1274,2659,3095,143
8,1817,2650,3220,2458,2279,1390,1464,2736,2701,1868,950,1151,1731,1506,1827,1597,863,3176,2296,3118,2417 ,1451,759,2238,2412,1864,1714,3616,2702,3143,2707,1701,1395,3209,2383,2528,2363,1803,1008,2269,2418,3333 ,2661,1623,1482,3456,2470,1276,510,2473,2499,1435,1652,3125,2662,2591,3346,2283,2460,2391,2420,979,1492,
3233,2823,953,1928,1829,1389,2365,3587,1738,763,2270,3147,1872,974,2474,2501,1453,1643,2285,3172,1713,18
18,1215,1402,2607,3218,1629,1520,1830,1691,3340,2881,954,1459,1734,879,2852,2760,3130,2882,981,1505,2709 ,3101,1706,982,2856,2827,3265,2665,2652,3589,2481,2768,2864,3149,1924,927,3224,2884,1833,1639,2395,2945,
3184,2291,1447,1746,3345,2710,1343,1679,3648,2502,2366,2723,1820,1761,1479,1275,995,1740,3158,2666,1401, 1888,765,956,3129,2946,2829,3362,1496,1861,3268,2424,887,1437,985,1720,2476,3594,997,1630,1813,1462,2713 ,2784,2615,3155,3240,3126,1398,1645,2888,2673,2286,3207,2407,2505,2447,2835,1848,1687,2639,2726,1247,171
6,2482,2725,3338,3590,1936,986,1483,1651,1745,943,2397,3348,1859,1508,3150,2293,3236,2506,1834,1454,2714 ,3161,2668,3601,891,1841,998,1595,3211,3361,1278,766,1465,1709,2411,2175,1764,1646,3115,2239,3173,2830,2
455,2484,1737,511,2674,3266,1485,1404,2619,2513,1693,1866,2729,2294,2755,3394,1952,1491,988,1657,1752,18
07,2398,3132,2647,2716,3596,2838,1399,1844,3213,3368,2508,3171,1001,951,1654,1926,3248,2297,2730,3712,17
07,1391,2621,3219,2459,2851,1002,1468,3164,2837,3352,2757,2413,2488,1836,1494,1873,1271,2676,2737,1694,8
93,2422,3272,1923,1461,2471,3604,1748,1715,2514,2841,975,1862,894,1815,3178,2298,2419,3222,1497,1653,252
9,2622,3396,2461,3157,2651,2414,3593,1510,1762,3335,3103,2516,3618,1842,1375,2703,2948,2853,2663,3214,27
32,1703,1009,3457,2758,1466,1874,3235,2477,955,1739,2842,2300,3162,2421,2653,3280,2896,2738,1486,1930,27
61,2680,1889,1004,1658,1821,1718,1929,3364,2530,2854,3180,1599,1507,3131,2475,1776,1405,3225,2952,3617,2
462,1735,1831,3339,2271,3174,3602,1493,1010,2711,2740,2883,3376,1984,1455,2667,2520,957,1865,3185,2503,2
844,3237,3649,2857,2762,3296,2769,2885,2764,3134,983,1710,3350,3400,958,1514,2912,2858,3221,2654,1876,17
68,3242,2960,1721,1938,3151,2770,2744,2425,1660,1500,1403,1892,3472,2483,1819,1741,1516,987,3341,3608,19
32,1463,2865,3177,3840,2367,1012,1843,2669,3228,1749,999,2860,2532,3393,2478,3620,3186,3347,2886,2715,32
67,1838,1277,2536,3159,2287,2426,2507,2670,3458,2675,1647,1925,2485,2428,1498,1742,3249,3656,2866,3226,1
513,1880,1717,1016,1953,1837,3342,2509,1867,1631,3591,2544,2717,3238,1469,1747,3365,2727,767,1904,1724,1
524,3188,3127,989,1406,1754,1822,3269,2772,2889,3353,2677,3632,2399,2515,3408,2486,3163,2785,2299,2510,2
490,2489,1835,1499,3714,2517,3597,2295,2731,3244,1944,1863,1890,1467,1003,1522,3274,2890,3460,3175,2786,
3192,1763,1695,3356,2947,3650,2718,1850,990,1005,1937,3366,2831,3133,2897,1722,1845,3603,3241,1495,1655,
2868,3624,2776,2976,2839,2415,1765,1956,3424,2949,1487,1750,3281,2678,1869,1521,3369,2733,2892,3252,268
1,2759,959,1896,1263,1940,3166,2301,2739,3349,2872,3223,1770,1877,2950,2734,3716,3270,1509,1711,3464,318
1,2788,3395,1756,1846,2898,2423,3606,2492,1011,1960,3354,2518,3215,2531,3595,2463,1784,1870,1662,1013,25
33,2953,1985,1753,3250,2843,2521,3288,2682,2792,1927,1528,3664,2900,1849,1882,3008,3370,2913,2741,1766,1
511,3179,3842,3398,2845,3273,3652,3619,2954,1954,1719,3300,2763,3189,3378,1777,895,2855,2522,2684,3227,2
742,2302,1439,1006,3598,3713,1878,1891,2765,3119,3363,2623,2961,3488,2846,2859,2427,3256,1939,1661,3401,
3239,1502,1986,2745,3612,1852,1934,2479,3190,2655,3276,2537,3372,1723,1772,2914,2771,1515,1897,2534,362
1,3229,3282,2956,3841,3609,2766,1014,1470,2861,3412,1743,1931,2524,2904,3165,3459,2887,3377,3343,3194,27
73,2746,3520,2962,1017,1968,3297,2800,2916,2867,3397,2862,2487,2977,1881,1894,3245,3626,1769,1517,2538,3
187,1778,1941,1823,1659,3728,2671,1992,1875,3680,3384,1755,1501,2719,3246,3410,2787,1018,1900,3651,3605,
1725,991,3461,2964,3351,2511,3284,2891,3183,2429,3720,3402,2545,3634,2978,2869,2774,3009,3251,3230,1933,
1839,2920,3466,2540,3298,3380,2679,1525,1955,1988,1884,1726,1948,3622,3271,2777,3193,3653,2748,1780,151
8,3844,2491,1020,1767,1905,1851,3355,2789,1893,1945,3426,3610,3404,3253,2893,3367,2968,2430,3633,2870,34
73,2899,3277,2778,3657,2546,1757,1530,2928,3304,2790,2493,3440,2519,1958,1471,1007,2000,2683,3196,3744,2
980,3628,2735,1847,1898,3258,3468,3660,3373,1523,1942,3848,2951,3182,2873,1961,1871,3283,3409,1771,1529,
2548,3625,2894,3718,3243,2793,1912,1758,2874,2780,1989,1946,3312,2494,3010,3474,3668,2984,3425,2523,152
6,1906,2901,3358,2915,2685,3599,3278,1883,1773,3462,2955,3254,3715,3636,3381,2535,3856,1957,1853,2743,34
89,3135,2794,1976,1015,2876,2801,3658,2902,3285,3374,1751,1993,1503,1962,2905,3416,3257,2552,2847,3403,2
303,3012,1781,1885,3290,2957,1908,2016,3721,3607,3357,2767,3191,2525,3665,2963,3496,3428,2686,2796,1854,
1532,2992,3776,3379,3275,2917,3640,3476,2539,274

7,3301,1972,1774,3399,2802,1019,1895,3231,3613,2906,3666,3465,3524,2526,3016,3308,2431,1987,1969,3260,2958,3849,2863,3627,3024,1782,1279,2918,3732,3681,2965,1943,1899,3385,3289,1994,1663,3654,3872,2775,3198,3490,2541,3405,3299,1964,1785,3724,2921,1021,1935,3432,2749,3614,2979,3371,3846,3413,3521,2804,3382,2908,2547,2779,3696,3286,2871,3623,2970,3247,3722,1886,2001,2922,3480,3469,2966,1407,1779,1990,1970,3684,3302,2550,3843,1879,1022,2981,3414,1902,1947,3386,3730,3635,3259,3536,2791,3406,2808,3292,3629,2929,3195,2542,3427,3320,2750,2969,3672,2549,2924,1759,1907,3463,2895,3904,3492,3040,3745,1527,1996,1786,1959,2495,3655,3484,3417,2002,1913,3305,3752,1949,2017,2781,3845,1534,1788,3717,3388,3279,2875,3638,2982,3682,3522,2930,2985,3011,3467,2795,3313,3167,2553,3429,2903,2972,3858,1910,1965,2782,2877,3611,3261,3659,3411,2004,1901,3478,3306,3736,3434,3013,3662,3778,3287,1966,1775,2986,2932,2008,1531,2554,3375,3637,3852,1971,1950,2797,3418,3688,2993,3014,3504,3729,2803,3314,2907,1909,1991,3475,3641,3436,2988,3262,2878,3857,2959,3669,3630,3880,2919,2018,1727,2687,3528,3746,3383,2936,3420,3293,2527,3470,3316,1916,1855,1974,1995,2994,3780,3725,2798,3850,3674,3441,3017,2020,1977,2556,3661,2909,3494,3905,3387,2805,3430,3018,3748,3291,2967,1787,1914,3642,3481,3874,3552,2923,3683,3307,2910,2005,1887,3968,3723,1023,1963,3493,2806,3197,2996,3407,3864,3644,3719,3760,3025,3433,2971,3670,3020,3482,3359,1998,1783,3777,2809,3444,2925,2024,1980,3255,3523,3497,3860,3000,3734,2543,3310,1903,1973,3692,3667,3389,3477,3873,2751,3419,3686,3615,3784,2983,3733,3026,3673,2931,2810,3294,2551,3506,2973,3442,3317,2003,1789,2926,3526,2783,3847,1997,2032,3726,3908,1978,1917,3491,3685,2010,1519,3529,3421,3747,3303,3041,3639,3876,3500,2933,2987,3042,3448,3792,3704,3028,3737,2974,2812,3318,2989,3676,3415,3853,3505,2019,2006,3969,3631,3435,3690,1951,1911,3015,3315,3532,3498,2021,2009,2934,2879,3731,3390,3859,2995,3753,3479,2555,3309,3888,2937,3698,3032,3808,3538,3663,2799,1790,2026,3750,2990,3906,3471,3508,3431,3044,3740,3689,3862,3019,3525,1975,2012,3321,3560,3781,2938,3646,3422,1967,1915,2557,3854,3970,3697,2997,3021,3445,3537,3756,3675,3048,3738,2940,3322,3486,3865,3438,3512,2025,2022,3916,2998,3199,3779,3554,3875,3645,2911,1981,1918,2033,1999,3499,2807,3912,3762,3749,3443,3851,3056,3671,3530,3324,2558,3483,3700,3027,3540,3001,3976,3877,3437,3786,2811,2028,1533,3920,3022,3501,3691,3761,3866,3263,3450,3677,3568,3878,3739,3002,3507,3782,2927,3029,3553,2011,1982,3754,3030,3972,2975,3881,3687,3495,3794,2034,1979,3391,3727,3868,3809,3527,3323,3043,3788,3449,3936,2813,3004,3544,3909,2935,3485,3033,3768,3045,3678,3861,3510,2023,2013,3446,3693,2036,2007,3896,3735,3295,3764,3984,3034,3531,3699,3793,2991,3907,3556,3882,3502,2939,3889,3046,3643,3326,2814,3513,3757,3812,3694,2030,2014,3785,2559,3533,3452,3741,3914,2040,1535,4000,3539,3036,3705,3800,3855,3447,3892,3049,2999,3702,3974,3755,3439,3050,3516,3884,3542,3921,3319,3742,2941,3971,3509,3796,3763,2027,2029,3023,3910,2942,3863,2035,2037,3545,3701,3558,3810,3890,3423,3751,3057,3514,3922,3003,3787,3534,3978,3937,3052,3706,3869,3766,3977,1791,2038,3647,3555,3824,3453,3783,3879,3541,3058,4032,3503,3005,3913,3031,3758,3006,3562,3924,3816,2041,1919,3769,3986,3708,3548,3451,3940,3867,3789,3564,3035,3980,3511,3060,3891,3797,3047,3886,3325,3695,3973,3546,3790,3561,3928,3765,3064,4001,3885,3915,3679,3517,3795,2815,3952,3772,3572,3037,3454,3802,3870,2042,2039,3883,3547,3992,3911,3938,3515,3051,3570,3811,3743,3898,3038,3053,3985,3770,3893,3543,3703,3813,4004,3535,3798,3917,3569,2044,2043,3007,3944,3311,3988,3818,3925,3557,3759,3804,3894,3059,4008,3832,3918,3710,3061,4033,3801,3975,3576,3897,3930,2031,1983,3814,3559,4002,3767,3825,2943,3487,3054,3926,3939,3987,3709,3550,4034,3900,3982,2046,2047,3771,3820,3563,3945,3062,3518,3791,3979,3065,4016,3929,3942,3817,3565,3826,3989,3871,3707,4040,3923,3803,3549,3066,3948,3773,3039,3981,3887,3573,4003,4036,3932,3774,3996,3828,3566,3068,3815,3953,3899,3941,3993,3805,3578,4006,3519,3055,4048,3 895,3946,3571,3990,4009,3919,3819,3577,3960,3806,4037,3994,3574,3954,3931,3821,4005,3901,4024,3063,3799,4041,3551,4010,3829,3933,3956,4064,2015,2045,3902,3580,4020,3822,3067,3943,4035,4017,3830,3327,3991,3947,4042,3711,4012,3833,3069,3983,3934,4049,3455,3827,4038,4018,3927,3070,3950,3995,3807,3955,3575,4044,3834,4007,4050,3961,3997,4065,3582,3836,3958,4013,4052,3949,4014,3823,4056,3579,4019,3998,3957,4039,4066,3775,3964,3903,4022,4043,4068,4025,3835,3962,4053,3935,3071,4011,4046,3831,4072,4028,3951,4021,4051,3837,4045,4080,4026,3965,4058,3567,4067,4054,3999,3959,4069,4057,3838,4074,4023,4060,4015,3963,4073,4070,4029,3966,4081,4047,4076,3581,4059,4030,4082,4027,4071,4061,4084,4055,4078,4062,4088,3583,4075,4077,4083,4085,3839,4086,4089,3967,4090,4087,4092,4091,4079,4031,4094,4095,4063,4093]

**Sequence group 8: Z8_4096**

[0,1,2,7,3,8,11,24,4,10,13,28,16,33,35,77,5,12,14,32,19,38,47,81,22,46,42,88,57,96,102,168,6,17,21,40,23,45,51,90,29,55,59,97,72,110,116,186,34,61,75,114,80,123,135,197,87,137,148,225,153,238,260,381,9,18,26,54,30,58,71,105,36,76,62,117,84,127,142,206,44,74,86,136,92,145,152,233,100,155,170,252,184,268,287,424,53,89,98,151,111,162,178,265,121,179,196,279,210,301,317,461,139,204,230,307,236,320,345,494,257,353,375,519,396,544,587,815,15,25,31,73,39,79,82,141,48,85,93,150,101,160,165,262,56,94,103,163,115,177,193,282,126,194,205,296,232,314,340,481,64,108,122,183,128,195,213,309,149,228,237,322,256,351,369,518,164,246,266,357,280,389,398,539,303,412,446,574,471,608,678,817,69,124,144,216,159,235,255,355,169,258,271,380,288,397,423,563,191,283,297,409,321,438,465,618,334,474,499,650,527,688,714,943,212,310,328,450,358,480,503,667,393,515,540,704,576,718,786,1016,421,554,588,753,603,805,833,1073,673,853,883,1064,915,1129,1203,1490,20,37,41,91,49,95,106,176,50,107,118,187,132,207,217,336,63,119,133,222,146,231,244,337,154,243,261,374,284,392,404,538,67,143,156,224,173,247,267,390,181,275,289,406,300,435,454,600,180,298,312,434,333,468,483,651,362,505,528,687,552,712,758,993,78,167,174,273,190,294,311,425,198,316,326,463,346,492,509,685,259,341,359,497,382,525,549,706,415,558,594,750,621,802,840,1054,293,377,407,535,431,573,598,788,459,614,634,814,679,864,894,1103,500,675,689,884,707,917,870,1145,769,981,1017,1218,1025,1315,1367,1549,83,188,192,332,248,350,368,504,274,373,383,532,414,560,593,790,290,410,430,561,448,599,625,820,475,639,666,858,705,891,939,1153,335,436,453,624,482,657,693,874,530,696,716,935,770,911,1003,1228,571,742,796,985,821,1024,1059,1278,865,1067,1066,1351,1147,1387,1431,1684,376,472,506,697,559,717,757,955,595,789,807,1018,850,1033,1065,1309,628,829,876,1055,898,1071,1149,1389,951,1162,1199,1441,1254,1509,1546,1821,686,888,929,1151,1001,1156,1242,1464,1014,1234,1284 ,1529,1334,1581,1658,1934,1035,1320,1381,1605,1414,1668,1630,1963,1485,1725,1760,2074,1844,2124,2211,2399,27,43,52,99,60,120,134,214,66,138,147,221,158,241,245,386,68,157,166,240,175,295,304,420,200,306,331,460,348,485,507,702,70,172,189,299,202,329,342,478,215,354,370,516,388,545,568,720,229,378,401,556,426,592,609,776,440,601,641,828,648,856,889,1213,109,201,211,347,223,371,387,534,253,405,416,580,443,616,638,794,272,419,452,606,477,646,653,842,496,655,664,893,740,918,975,1230,291,476,490,662,524,691,701,903,548,739,763,950,810,994,1019,1289,579,785,824,1021,866,1050,1113,1337,925,1120,1166,1396,1200,1451,1518,1814,112,219,242,399,270,417,447,620,286,455,479,656,501,669,681,900,315,491,521,683,547,730,755,946,577,774,808,1010,843,1036,1091,1294,343,533,567,759,610,797,795,1039,629,832,854,1074,905,1117,1137,1401,668,867,921,1130,947,1181,1202,1468,980,1226,1267,1530,1347,1591,1661,1947,364,586,615,834,652,863,907,1121,727,924,962,1195,966,1208,1249,1505,743,964,979,1239,1047,1266,1326,1578,1100,1344,1379,1608,1425,1694,1738,1974,775,1061,1084,1297,1142,1355,1386,1647,1167,1419,1471,1720,1519,1768,1831,2089,1273,1473,1533,1781,1602,1858,1887,2185,1649,1913,1961,2235,2025,2312,2385,2666,129,254,278,458,313,489,517,711,324,526,555,737,581,766,819,1093,356,569,619,791,643,861,845,1102,658,877,914,1161,958,1187,1216,1486,427,632,659,859,726,902,930,119 8,736,961,973,1217,1000,1250,1277,1555,744,990,1028,1275,1098,1323,1371,1611,1132,1411,1424,1701,1472,17 39,1801,2057,442,725,729,948,749,965,1009,1260,784,1048,1081,1311,1118,1362,1416,1673,920,1095,1144,1373, 1171,1448,1475,1727,1255,1480,1540,1787,1604,1850,1879,2179,972,1180,1238,1450,1274,1526,1562,1811,1332, 1587,1618,1876,1669,1915,1972,2261,1384,1654,1712,1960,1759,2008,2056,2322,1818,2077,2117,2378,2158,245 9,2472,2831,451,751,765,1089,901,1107,1136,1409,937,1157,1191,1459,1246,1497,1553,1805,977,1214,1269,151 3,1307,1565,1621,1869,1366,1666,1613,1903,1730,1967,2024,2283,1101,1279,1322,1595,1399,1634,1703,1954,14 37,1713,1758,2009,1797,2029,2097,2363,1522,1775,1826,2061,1891,2136,2173,2431,1930,2228,2258,2510,2313,2 560,2578,2754,1176,1327,1434,1718,1491,1752,1778,2048,1547,1839,1862,2110,1905,2137,2239,2470,1559,1899, 1956,2224,2022,2266,2271,2574,2081,2324,2359,2603,2414,2672,2719,2941,1676,2002,2010,2306,2106,2328,238 0,2617,2154,2430,2444,2704,2525,2720,2839,3018,2201,2503,2551,2782,2612,2793,2884,3089,2651,2902,2936,31 42,2984,3186,3223,3400,140,113,65,285,104,263,182,502,125,185,203,444,220,352,323,572,161,218,239,330,264, 408,372,663,302,384,422,541,462,731,612,897,171,249,269,391,305,413,469,589,325,493,439,816,531,633,674,12 09,349,473,557,647,514,700,781,1043,582,764,728,934,841,1094,967,1470,199,292,308,449,344,484,537,682,379, 605,495,715,570,745,804,978,411,529,645,777,613,892,762,1015,562,809,916,1060,860,1258,1128,1724,441,642,5 83,851,719,818,944,1083,672,991,882,1184,931,1141,1410,1314,752,954,1005,1285,1042,1196,1229,1508,1085,13 45,1263,1655,1397,1890,1579,2174,234,327,365,520,400,553,604,787,437,684,575,812,635,848,904,1150,464,611, 721,857,665,974,885,1133,748,936,1029,1201,995,1244,1329,1536,498,710,649,910,806,959,1037,1223,780,1097, 976,1418,1075,1282,1295,1614,852,1026,1160,1328,1119,1361,1460,1924,1219,1484,1404,1645,1552,1741,1800,2 248,546,738,825,1011,768,1046,1139,1343,871,1188,1080,1525,1231,1378,1455,1700,919,1112,1245,1412,1310,1 476,1610,1755,1163,1573,1496,1868,1652,1820,1962,2352,963,1272,1335,1583,1194,1531,1627,2001,1385,1690,1 749,1878,1548,2075,1935,2756,1430,1721,1786,2049,1823,1969,2028,2455,1660,2114,2159,2305,2210,2629,2384, 3163,281,385,418,607,470,690,640,896,488,654,798,942,724,988,1032,1262,536,754,703,1008,803,1131,970,1308, 862,1049,1148,1354,1088,1504,1449,1909,578,813,767,1212,928,1038,1092,1363,849,1116,1177,1596,1235,1407, 1477,1761,949,1261,1197,1524,1336,1463,1603,1817,1293,1572,1638,1855,1699,1942,2059,2296,617,1002,835,11 43,890,1276,1186,1532,971,1222,1317,1487,1360,1582,1648,1892,1058,1413,1296,1745,1251,1598,1635,2031,148 1,1687,1769,1948,1819,1995,2119,2495,1106,1440,1358,1659,1515,1726,1859,2103,1590,1902,1751,2044,1796,22 31,2168,2439,1388,1838,1968,2195,1914,2142,2338,2424,2011,2310,2249,2596,2403,2539,2673,3214,692,906,102 0,1259,1082,1306,1458,1672,1140,1542,1333,1719,1405,1620,1822,2099,984,1372,1435,1794,1528,1943,1748,206 9,1619,1873,1908,2214,1686,2323,2162,2838,1215,1469,1580,1990,1675,1886,1851,2292,1514,1928,2053,2184,20 05,2242,2373,2557,1779,2033,1966,2259,2102,2463,2331,2607,2169,2386,2506,2703,2445,2662,2885,3017,1268,1 599,1707,1925,1543,2111,1973,2304,1815,1994,2207,2360,2052,2402,2520,2742,1646,2143,2083,2413,2225,2550, 2453,2730,2318,2478,2642,2693,2595,2931,2858,3098,1875,2267,2176,2535,2367,2770,2488,2815,2115,2648,257 9,2874,2602,2917,2981,3473,2253,2747,2705,3032,2669,2968,3064,3256,2805,3043,3009,3317,3127,3609,3272,37 01,363,445,508,713,566,741,799,1034,602,895,771,1152,844,1072,1204,1454,644,811,945,1096,875,1301,1146,15 03,989,1248,1359,1740,1227,1537,1594,1950,680,938,899,1190,1004,1243,1342,1612,1099,1415,1283,1558,1400, 1653,1807,2041,1051,1370,1321,1644,1462,1762,1702,2003,1527,1795,1872,2381,1896,2178,2118,2534,756,960,1 090,1300,1189,1346,1576,1685,1027,1380,1474,1744,1406,1845,1753,2088,1170,1512,1541,1939,1436,1806,1904, 2206,1667,1957,1833,2151,2030,2252,2329,2657,1292,1564,1706,1877,1626,1991,1949,2287,1774,2108,2045,224 3,1938,2339,2391,2638,1609,2131,2080,2361,2215,2479,2432,2731,2017,2415,2526,2923,2594,2855,2792,3173,85
5,1205,1070,1461,1138,1698,1417,1897,1316,1502,1615,1883,1586,1830,1982,2297,1288,1780,1639,2058,1563,19
55,1931,2349,1750,2023,2155,2255,2107,2406,2458,2713,1398,1677,1816,2000,1863,2194,2096,2502,1691,2068,2
270,2438,2150,2387,2575,2771,1898,2246,2189,2467,2353,2650,2528,2825,2325,2588,2726,2870,2668,2940,2972,
3349,1523,1912,1754,2175,1827,2116,2260,2544,1951,2398,2234,2511,2307,2601,2643,2888,2016,2362,2293,266
3,2466,2616,2743,3096,2416,2797,2674,2930,2776,3008,3051,3248,2082,2303,2489,2712,2390,2738,2814,2985,25
85,2916,2764,3042,2871,3073,3139,3313,2538,2830,2920,3215,2980,3108,3162,3419,2790,3183,3258,3386,3273,3
459,3530,3756,992,1247,1185,1631,1350,1695,1597,1975,1408,1554,1832,2200,1763,2032,2125,2417,1465,1804,1
731,2060,1929,2330,2109,2473,1893,2163,2247,2600,2302,2527,2675,2922,1577,1946,1874,2177,2004,2230,2254,
2545,1810,2286,2372,2692,2452,2653,2628,2961,2076,2379,2494,2613,2425,2727,2777,3026,2348,2808,2718,298
7,2862,3083,3126,3361,1674,1854,2098,2366,1983,2319,2471,2701,2188,2561,2407,2656,2172,2746,2791,3039,22
38,2454,2507,2927,2584,2765,2842,3222,2649,2912,2809,3072,2971,3109,3208,3397,2311,2524,2702,2843,2597,2
990,2913,3143,2755,2875,3027,3169,2937,3303,3226,3434,2667,2986,3065,3249,3112,3334,3294,3505,3050,3265,
3387,3553,3360,3469,3583,3777,1882,2040,2130,2462,2282,2639,2433,2804,2229,2529,2521,2889,2606,2960,286
3,3187,2358,2721,2589,2854,2757,2921,3033,3168,2700,2991,3055,3227,2973,3268,3323,3504,2412,2652,2824,29
69,2739,3082,3016,3259,2783,3038,3099,3401,3182,3295,3312,3552,2903,3155,3217,3322,3138,3435,3362,3544,3
088,3373,3468,3639,3425,3582,3629,3869,2556,2796,2859,3154,2970,3054,3216,3335,2926,3097,3172,3363,3257,
3464,3418,3585,3019,3209,3264,3458,3302,3396,3499,3667,3316,3511,3472,3628,3545,3663,3693,3964,3113,326
9,3348,3498,3372,3510,3573,3662,3424,3572,3531,3728,3608,3729,3692,3868,3465,3584,3638,3734,3666,3735,37
57,3819,3700,3776,3818,3845,3844,3965,3886,3887,130,131,208,251,209,276,319,432,226,318,339,466,366,511,5
13,747,227,338,360,510,395,542,591,773,428,590,564,800,637,836,868,1108,250,367,403,550,429,585,623,822,46
7,631,661,837,732,886,922,1164,512,671,735,912,772,941,987,1183,793,997,1040,1281,1053,1312,1368,1657,277,
394,456,630,486,660,723,873,522,746,676,923,782,957,1012,1224,584,734,792,996,826,1023,1052,1299,846,1057,
1110,1348,1158,1390,1433,1742,627,801,838,1045,887,1078,1126,1377,933,1127,1182,1421,1232,1467,1507,1809 ,999,1220,1290,1489,1304,1510,1571,1870,1357,1593,1641,1921,1688,1976,2043,2389,361,433,487,733,543,761,7
78,1007,596,783,827,1044,847,1076,1087,1374,636,830,869,1079,913,1125,1175,1426,956,1178,1221,1452,1298,1
500,1566,1849,694,880,940,1155,968,1179,1237,1493,1041,1286,1305,1516,1356,1589,1629,1920,1086,1338,1382 ,1607,1422,1679,1692,1965,1479,1716,1784,2020,1835,2078,2186,2393,709,952,1022,1252,1069,1303,1353,1601,
1109,1364,1393,1656,1438,1689,1737,1999,1173,1427,1453,1711,1511,1770,1825,2094,1556,1840,1885,2144,193
3,2202,2236,2547,1236,1494,1538,1790,1616,1848,1895,2167,1683,1917,1970,2220,2026,2244,2342,2632,1735,19
86,2046,2291,2067,2369,2409,2697,2181,2435,2475,2688,2513,2759,2837,3106,402,523,551,823,597,831,878,112
4,622,879,926,1165,982,1225,1253,1560,677,927,983,1270,1030,1291,1330,1561,1056,1325,1369,1640,1428,1682,
1704,1964,699,1013,1062,1280,1115,1339,1383,1680,1135,1403,1439,1708,1466,1765,1798,2064,1134,1456,1498,
1764,1551,1828,1853,2145,1622,1901,1936,2199,1984,2232,2300,2611,760,1105,1122,1395,1172,1446,1495,1743,
1192,1506,1534,1813,1574,1866,1911,2197,1365,1567,1617,1881,1662,1927,1981,2222,1723,1992,2054,2288,210
1,2364,2418,2682,1445,1643,1709,1953,1757,2019,2062,2344,1803,2090,2122,2388,2187,2450,2486,2737,1888,21
83,2203,2476,2223,2515,2460,2779,2321,2593,2633,2852,2641,2949,2999,3153,779,1168,1174,1550,1340,1588,16
28,1900,1402,1637,1663,1944,1722,1996,2051,2346,1442,1714,1756,1997,1788,2063,2105,2396,1841,2127,2166,2
442,2221,2483,2543,2789,1557,1766,1793,2104,1852,2153,2209,2464,1940,2212,2240,2537,2326,2509,2621,2864,
2015,2278,2354,2599,2397,2640,2685,2910,2451,269

1,2690,2983,2781,3013,3057,3260,1642,1836,1906,2213,199 3,2241,2299,2563,2055,2345,2371,2634,2428,2655,2689,2945,2112,2405,2468,2683,2492,2695,2785,3015,2559,28 00,2833,3063,2890,3119,3150,3357,2198,2480,2531,2787,2619,2794,2876,3080,2630,2868,2918,3135,2964,3179,3 240,3432,2659,2952,3007,3199,3044,3246,3220,3453,3103,3289,3318,3520,3374,3554,3597,3695,457,565,626,839 ,670,932,986,1240,698,998,1031,1265,1068,1319,1331,1670,708,1063,1104,1318,1123,1447,1482,1734,1206,1488, 1545,1808,1584,1857,1907,2218,722,1114,1169,1457,1210,1539,1568,1846,1241,1600,1632,1918,1678,1977,2012, 2250,1287,1650,1697,1988,1746,2050,2079,2334,1772,2065,2129,2404,2140,2440,2481,2847,881,1207,1233,1575, 1271,1633,1671,1952,1349,1705,1728,2036,1777,2092,2126,2350,1394,1733,1792,2072,1843,2138,2147,2420,188 0,2149,2164,2485,2276,2516,2583,2866,1443,1842,1864,2160,1926,2205,2217,2499,1980,2275,2309,2558,2376,26 14,2635,2925,2035,2341,2400,2637,2456,2680,2745,2967,2523,2752,2802,3020,2834,3069,3124,3350,908,1257,13 24,1693,1392,1729,1785,2100,1432,1799,1847,2152,1889,2171,2191,2496,1501,1865,1923,2193,1979,2268,2295,2 552,2027,2332,2374,2626,2421,2660,2717,2932,1569,1945,2007,2301,2084,2355,2351,2665,2113,2408,2436,2698, 2501,2749,2767,3025,2170,2457,2519,2760,2553,2813,2836,3084,2592,2860,2899,3136,2979,3189,3243,3441,162 4,2042,2091,2410,2146,2449,2505,2753,2263,2522,2568,2827,2572,2844,2883,3117,2279,2570,2591,2873,2677,28 98,2956,3176,2734,2976,3005,3200,3053,3270,3296,3462,2333,2687,2710,2935,2774,2989,3012,3233,2803,3049,3 087,3286,3125,3324,3367,3529,2905,3091,3141,3331,3196,3380,3403,3587,3235,3421,3451,3607,3491,3650,3687, 3810,969,1352,1420,1802,1499,1861,1919,2227,1520,1932,1987,2273,2037,2316,2395,2723,1606,2013,2095,2347, 2133,2447,2423,2736,2156,2469,2512,2799,2564,2819,2850,3104,1747,2120,2157,2443,2262,2498,2532,2832,227 2,2567,2581,2851,2618,2886,2909,3159,2280,2608,2646,2907,2732,2955,3001,3203,2762,3037,3052,3277,3090,32 97,3341,3513,1776,2257,2265,2554,2285,2571,2625,2894,2340,2678,2707,2947,2750,2996,3046,3251,2518,2725,2 778,3003,2807,3066,3093,3291,2891,3100,3146,3333,3198,3376,3395,3581,2580,2812,2872,3068,2906,3132,3164, 3347,2962,3185,3210,3392,3247,3423,3460,3625,3010,3238,3282,3450,3315,3482,3512,3654,3354,3523,3549,368 2,3566,3723,3732,3875,1791,2289,2315,2715,2497,2741,2766,3035,2541,2795,2823,3075,2880,3111,3157,3343,25 87,2848,2901,3121,2943,3167,3213,3385,2998,3244,3205,3413,3292,3455,3490,3633,2735,2911,2954,3191,3023,3 224,3279,3446,3061,3283,3314,3483,3339,3493,3533,3677,3128,3327,3364,3517,3405,3558,3575,3711,3430,3602, 3622,3746,3651,3768,3772,3846,2810,2957,3058,3284,3107,3308,3328,3506,3151,3371,3382,3542,3415,3559,361 1,3730,3161,3411,3448,3600,3488,3626,3631,3770,3525,3656,3673,3787,3704,3814,3831,3913,3254,3478,3484,36 46,3538,3658,3684,3793,3564,3710,3716,3826,3751,3832,3877,3934,3593,3743,3765,3856,3790,3861,3892,3955,3 803,3896,3910,3970,3924,3982,3991,4030,1006,909,695,1429,872,1375,1154,1894,953,1159,1211,1782,1264,1592 ,1517,2018,1077,1256,1313,1544,1376,1710,1636,2161,1478,1664,1736,1971,1812,2269,2086,2491,1111,1341,139 1,1681,1483,1717,1829,2047,1521,1867,1771,2392,1941,2121,2182,2845,1585,1837,1989,2139,1916,2216,2337,26 71,2038,2314,2264,2536,2419,2724,2573,3086,1193,1444,1492,1789,1570,1856,1959,2192,1651,2071,1871,2237,2 014,2281,2368,2590,1715,1937,2135,2335,2087,2484,2308,2631,1998,2375,2514,2686,2446,2892,2758,3288,1773, 2132,2039,2429,2245,2394,2548,2709,2180,2609,2474,2816,2533,2773,3036,2948,2290,2562,2623,2919,2670,282 8,2865,3118,2711,2977,2897,3239,3021,3404,3177,3576,1302,1535,1625,1922,1696,1985,2070,2343,1767,2196,20 21,2382,2123,2426,2500,2786,1824,2085,2251,2441,2165,2582,2477,2763,2284,2540,2647,2835,2615,2878,2959,3 144,1884,2226,2141,2508,2370,2565,2661,2857,2336,2729,2586,3048,2699,2914,2933,3206,2434,2644,2798,2958, 2751,2995,3076,3426,2853,3102,3028,3231,3156,3299,3340,3616,1978,2274,2401,2627,2320,2676,2769,2975,246 1,2820,2706,3131,2867,3004,3071,3276,2517,2744,2879,3040,2946,3094,3202,3311,2801,3171,3110,3384,3236,33 56,3452,3670,2569,2904,2965,3181,2826,3137,3219,3477,3011,3266,3305,3394,3152,3521,3433,3848,305

6,3287,3 332,3507,3359,3457,3492,3721,3242,3546,3567,3645,3596,3795,3686,3975,1423,1665,1732,2073,1834,2204,2128, 2490,1860,2148,2356,2546,2256,2604,2654,2896,1958,2294,2219,2624,2365,2761,2576,2944,2448,2679,2784,2988,2714,3116,3067,3417,2034,2383,2317,2846,2530,2664,2722,2997,2427,2748,2811,3192,2869,3031,3095,3319,2555,2895,2829,3130,2966,3079,3197,3353,2929,3170,3228,3379,3275,3438,3515,3640,2093,2620,2411,2775,2482,2908,2818,3140,2577,2856,2951,3105,2994,3180,3234,3406,2684,3041,2934,3301,2887,3194,3225,3495,3101,3263, 3325,3442,3355,3475,3551,3741,2740,3062,2992,3241,3123,3290,3381,3537,3188,3412,3307,3502,3338,3605,3570,3715,3014,3370,3456,3591,3422,3560,3664,3708,3485,3648,3617,3782,3697,3761,3815,3986,2208,2504,2636,2893,2708,2942,3074,3250,2772,3148,2963,3285,3029,3212,3358,3535,2598,3002,3059,3336,3134,3439,3304,3519,3211,3389,3416,3598,3262,3655,3568,3876,2849,3085,3178,3470,3253,3402,3377,3636,3122,3428,3509,3586,3481, 3612,3681,3767,3329,3497,3454,3623,3536,3725,3661,3789,3571,3688,3744,3825,3717,3808,3893,3933,2900,3195,3281,3427,3149,3543,3461,3644,3351,3474,3595,3674,3508,3696,3748,3840,3232,3561,3527,3703,3601,3764,3719,3836,3652,3736,3798,3821,3781,3909,3882,3958,3391,3627,3578,3759,3679,3852,3738,3871,3547,3800,3773,3890,3786,3901,3923,4045,3619,3843,3827,3938,3813,3916,3948,3996,3865,3943,3931,4013,3967,4065,4004,4077, 1623,1783,1910,2233,2006,2277,2357,2658,2066,2487,2327,2788,2422,2696,2840,3070,2134,2377,2549,2728,2465,2939,2780,3115,2605,2882,2993,3298,2861,3145,3190,3444,2190,2542,2493,2822,2622,2877,2974,3204,2733,3045,2915,3160,3024,3237,3345,3501,2681,3000,2953,3230,3078,3320,3278,3479,3133,3337,3388,3685,3408,3580,3550,3758,2298,2566,2716,2938,2821,2978,3174,3261,2645,3006,3092,3300,3030,3375,3309,3528,2806,3120,3147, 3437,3060,3344,3414,3594,3245,3449,3369,3563,3494,3618,3659,3807,2928,3166,3280,3393,3218,3471,3443,3635,3326,3540,3503,3613,3436,3665,3691,3796,3201,3557,3524,3675,3599,3737,3712,3837,3487,3705,3752,3905,3780,3881,3860,3979,2437,2841,2694,3077,2768,3274,3047,3409,2950,3114,3207,3399,3184,3366,3466,3641,2924,3330,3229,3514,3165,3447,3431,3669,3306,3489,3565,3621,3539,3698,3722,3829,3022,3255,3352,3476,3383,3590, 3532,3742,3267,3518,3630,3714,3562,3689,3771,3853,3410,3614,3589,3727,3671,3802,3754,3873,3657,3778,3834,3888,3812,3912,3920,4019,3129,3420,3310,3577,3365,3548,3624,3762,3445,3694,3606,3747,3647,3785,3799,3894,3486,3676,3637,3809,3726,3792,3841,3956,3706,3863,3816,3908,3854,3930,3945,3994,3526,3643,3739,3828,3690,3838,3870,3925,3775,3900,3850,3942,3889,3951,3969,4011,3760,3874,3902,3987,3922,3960,3974,4033,3858, 3981,3998,4026,4005,4039,4052,4082,2610,2881,2817,3221,2982,3271,3193,3463,3034,3158,3368,3592,3321,3496,3555,3707,3081,3342,3293,3516,3429,3660,3541,3733,3407,3569,3615,3784,3642,3753,3817,3904,3175,3440,3390,3579,3480,3604,3620,3763,3346,3634,3680,3820,3718,3805,3794,3915,3522,3683,3740,3791,3709,3835,3855,3936,3668,3866,3830,3927,3884,3953,3966,4021,3252,3378,3534,3678,3467,3653,3731,3823,3588,3769,3699,3806, 3574,3842,3859,3941,3610,3720,3745,3907,3774,3851,3878,3990,3801,3898,3867,3950,3919,3961,3984,4029,3649,3750,3824,3879,3783,3928,3899,3971,3847,3891,3937,3977,3911,4009,3992,4036,3811,3926,3949,3995,3962,4016,4006,4049,3944,4001,4027,4057,4020,4043,4061,4085,3398,3500,3556,3724,3632,3797,3713,3864,3603,3755,3749,3895,3788,3914,3885,3983,3672,3833,3779,3880,3849,3903,3939,3976,3822,3929,3947,3993,3921,4002,4015, 4048,3702,3804,3872,3917,3839,3952,3932,3999,3857,3940,3959,4031,3980,4007,4010,4056,3897,3973,3989,4014,3968,4037,4022,4054,3954,4025,4042,4069,4035,4060,4067,4091,3766,3862,3883,3972,3918,3946,3988,4017,3906,3957,3978,4023,3997,4040,4032,4063,3935,3985,4000,4038,4008,4028,4047,4073,4012,4051,4044,4066,4055,4071,4075,4094,3963,4003,4018,4046,4024,4050,4059,4070,4034,4058,4053,4078,4064,4079,4074,4090,4041,4062, 4068,4080,4072,4081,4083,4087,4076,4084,4086,4089,4088,4095,4092,4093]

**Sequence group 8: Q8_8192**

[0,1,2,4,8,16,32,3,5,64,9,6,17,10,18,128,12,33,65,20,256,34,24,36,7,129,66,512,11,40,68,130,19,13,48,14,72,257,21,132,35,258,26,513,80,37,25,22,136,260,264,38,514,96,67,41,144,28,69,42,516,49,74,272,160,1026,520 ,288,528,192,544,70,44,131,81,50,73,15,320,133,52,23,134,384,76,137,82,56,27,97,39,259,84,138,145,261,29,43,98,515,88,140,30,146,1028,71,262,265,161,576,45,100,640,1025,51,148,46,75,266,273,517,104,162,53,193,1032,152,77,164,768,2048,2049,268,274,518,54,83,57,521,112,1024,135,78,289,194,85,276,522,58,168,139,99,86,60,280,89,290,529,524,196,141,1040,101,147,176,142,530,321,31,200,90,1056,545,292,322,532,263,149,102,105,304,296,1030,163,92,1033,47,267,385,546,324,208,386,150,153,165,106,55,328,1088,536,577,548,1034,113,154,79,269,2050,2052,108,578,224,166,519,552,195,270,1041,641,1036,523,275,580,291,59,2056,2064,169,560,114,277,156,87,1152,197,116,170,61,1042,531,525,642,281,278,526,177,293,388,1057,2080,2051,91,584,769,198,172,120,201,336,4096,4097,4098,4100,62,282,143,1029,1044,103,178,294,93,1058,644,202,592,323,392,297,2053,2112,770,107,180,1280,151,209,284,1027,648,94,204,298,400,608,1089,352,325,533,155,210,305,547,300,109,1048,184,534,1060,537,115,1090,167,225,326,306,772,157,656,329,110,2057,2054,117,212,171,1038,776,1064,330,1153,226,549,1043,538,387,308,216,416,271,279,2065,2058,158,337,550,672,1092,118,332,579,540,1072,389,173,1037,121,553,199 ,784,179,228,338,2066,2176,312,1536,704,1154,2060,2081,390,174,554,581,1046,393,283,122,448,353,561,1096,203,63,340,394,1049,1281,527,582,556,181,295,1059,285,232,2113,2068,124,205,182,643,1156,562,2304,2082,286,585,299,354,1045,211,401,1104,4104,4112,4128,4099,185,1061,396,344,586,645,1282,593,535,240,1050,206,95,327,564,800,2072,2084,402,356,2055,2177,307,301,417,1160,213,1066,568,1120,832,588,4101,4160,4105,4102,1035,1537,186,646,404,1091,227,896,594,418,302,649,2114,2560,771,360,539,111,1052,331,1168,214,2059,2088,309,1062,1284,188,449,1073,217,408,609,596,551,650,229,159,420,310,1093,541,2116,2178,4113,4106,4114,4224,1288,773,610,657,333,1065,119,1098,600,339,1184,218,368,652,1031,230,391,313,450,542,1538,334,2067,2061,2096,2062,1076,233,555,774,175,123,1155,658,2120,2305,612,341,777,220,314,1105,424,1068,395,673,583,355,4108,4129,4161,4116,1296,1094,287,183,234,1051,2069,2180,125,557,1216,660,616,342,2083,2306,316,1157,241,778,563,1074,345,452,397,403,1112,207,2074,2561,1540,674,558,785,1100,432,1039,357,187,1162,236,664,1312,624,587,780,1080,1122,2128,2085,705,126,242,1063,2073,2070,565,398,346,456,2184,2308,358,405,303,569,1544,244,1158,1097,595,1283,189,566,676,1169,1054,1108,361,706,4352,4130,4120,4132,589,1344,215,786,647,348,2312,2086,419,406,2562,2144,464,680,2115,2089,801,1069,362,1164,2192,2076,590,409,1286,570,1121,788,1552,1106,597,1075,572,1186,219,311,4103,4225,4162,4608,708,598,1289,601,651,421,792,802,2117,2090,611,1047,602,1172,410,231,688,653,2564,2097,1128,248,1070,369,2122,2320,190,364,1568,654,1095,659,1161,335,480,315,221,370,1285,613,4107,4136,4164,4226,1408,422,2208,3074,425,451,2568,2336,4115,4109,4144,4110,1077,614,543,1298,235,412,343,372,2576,2240,1185,775,317,1539,222,1099,426,453,237,1124,559,1170,2592,2118,1292,833,804,712 ,1082,834,661,1053,2092,2179,2129,2098,808,779,1217,617,604,1541,433,720,816,1101,2121,2063,1176,836,347,897,4168,4353,4117,4228,1136,243,1297,662,1600,454,318,675,2368,2181,1110,618,4131,4354,4122,4609,1081,898,781,1314,1220,376,428,1546,2100,2071,665,736,567,1107,2182,2432,1192,1078,2124,2185,840,625,238,1159,359,457,399,787,2130,2104,591,678,434,677,1290,1542,2075,2145,349,1300,1102,245,1188,458,666,1113,620,1553 ,4176,4133,4121,4118,1163,1313,363,127,4232,4356,4360,4134,1067,191,1125,782,407,436,2087,2307,626,1218,2132,2186,571,465,2193,2309,681,246,707,1346,2077,2091,2146,2563,350,1084,599,668,1548,790,2136,2188,1165,1320,460,1123,1200,249,682,1664,573,1171,411,803,4610,4192,4163,4137,1116,789,1304,709,365,440,628,689,2078,2194,374,1224,3076,2119,423,1556,4240,4124,4165,4138,466,793,2310,2313,2209,2624,1130,250,371,1174,2093,2148,481,574,1348,413,1109,603,366,1545,1287,1055,468,1570,655,900,805,615,1166,684,1409,710,2688,3073 ,1187,429,4612,4145,4170,4368,2099,2196,794,252,1114,373,605,1232,848,690,2094,2123,713,63

2,2314,2321,131 6,482,806,1132,2565,2152,1083,427,1177,904,1569,414,2210,2101,1291,223,1126,1554,663,692,835,1328,619,472 ,2241,3080,1137,455,4256,5122,4616,4384,4624,4288,4640,4166,2200,2125,796,1189,1601,809,714,1248,721,837, 716,1086,2212,2816,1302,1352,4140,4227,4177,4146,864,810,1173,606,1194,912,1103,722,696,377,2316,2322,14 24,435,2566,2102,1293,1560,817,1129,1792,319,621,1180,2131,2105,2569,2160,812,484,1345,430,1572,1138,307 2,2183,4169,4111,4416,4229,1299,838,667,1219,2126,2337,488,1111,239,378,459,622,4148,4119,4230,4480,1410, 627,2242,2133,437,380,1201,1608,818,1178,2324,2570,1294,461,1543,496,669,1190,1317,679,2106,2216,1140,10 79,4172,4233,4178,4152,2187,2147,1221,724,841,1305,629,1584,2134,2108,351,467,2328,2137,1360,438,1115,73 7,2338,2577,251,462,442,441,2572,2244,1666,469,1549,247,683,1196,2189,3088,2149,2195,4123,4193,4135,4355, 1226,842,1412,1127,738,1144,2224,2190,4180,4234,4241,4357,1308,899,1602,670,1318,783,1085,849,4125,4139, 4194,4611,1555,1193,820,1576,728,928,791,367,2578,2369,1376,901,2079,2248,2138,3104,1233,630,2593,2340,1 321,685,844,1204,633,711,2370,2580,2311,2197,2150,2153,1118,253,691,1301,824,1175,2352,2344,902,686,1668, 1222,1416,1133,740,1347,4184,4236,4126,4242,850,375,1558,444,5124,4167,4358,4361,1306,470,1167,483,4257, 4672,4141,4196,1547,415,3078,2211,485,905,2140,3081,4736,5121,4147,4244,1202,795,473,1240,2095,2315,634, 744,2433,2594,1616,852,2372,2256,2434,2198,960,1322,2201,2213,865,693,2154,2103,1131,1794,1350,797,1225, 1604,1571,906,2376,3136,1252,715,1141,1330,807,474,636,1179,694,254,4142,4171,4362,4369,1550,1665,2584,2 625,717,1071,2596,3082,1315,575,913,1440,798,811,379,1208,4613,4200,4258,4149,2161,2202,1353,1191,2127,2 317,697,1564,4289,5128,4248,4173,431,1142,607,1228,2156,2626,489,1324,2272,2214,866,723,2567,2600,486,15 73,1181,1234,908,1793,1561,718,813,1364,2243,2318,476,856,3089,2689,1117,1411,4260,4864,6144,6145,839,13 29,1295,1146,4364,4370,4614,4150,3084,2571,725,698,1472,914,2323,2628,1249,752,868,819,1349,814,439,929,4 179,4153,4617,4208,2339,2107,1197,1578,490,1139, 2217,2608,1680,623,2162,2325,1632,1336,671,1198,1362,739 ,2204,2135,1603,1557,3200,2245,5120,4231,4174,4385,2164,2218,1413,916,1303,463,1236,843,2109,3090,1135,3 81,1672,1354,2579,2573,4290,4181,4372,4618,4154,4264,4235,4195,497,1586,930,821,2690,2329,726,961,1203,1 182,2326,2574,872,1418,492,1250,1332,631,2225,2341,4182,4156,4376,4185,2436,3105,1574,1223,729,1145,1605 ,700,2139,2632,1796,443,2817,2246,1307,741,2220,2168,1378,1562,1356,1205,845,1319,4386,4625,4620,4292,22 49,2384,920,382,2110,2330,1585,822,1425,851,2191,3077,3092,2151,1229,730,1609,498,2226,2342,4237,5136,41 97,4243,880,1256,742,445,1392,471,2141,3106,4272,4238,4626,4417,2692,2250,2640,2371,4127,4296,4186,5152, 635,1148,1696,932,1580,687,2440,2345,1210,1420,1612,1325,1800,903,1134,825,4641,4388,4418,4628,1235,1361 ,500,1577,846,1670,1195,745,2818,2155,2228,3328,4359,4245,4198,4201,826,732,2199,2257,2332,3075,1264,446, 2696,2142,962,1426,1620,936,2252,2346,1377,475,2448,2656,3137,2400,2373,2581,853,1310,867,637,2203,2258, 1551,1230,2353,2595,1414,907,1206,1667,1588,1333,4400,4392,5126,4259,487,1808,2348,2157,4188,5129,4143,4 363,695,1441,1087,746,4481,4642,4420,4304,828,753,1610,854,1237,1326,3096,2232,4482,4246,4249,4261,4202, 4151,4424,5184,857,1368,2582,3108,1209,504,799,1355,2585,2163,255,964,4632,4673,4644,5130,3138,2215,2273 ,2374,1242,909,2354,2820,2205,2704,1673,1559,1309,719,2377,2158,1143,477,2165,2260,1617,915,1448,1380,22 19,3086,638,748,2824,3112,944,1728,1331,1227,869,1592,1428,491,699,1253,4209,4250,4175,4365,1351,754,237 8,3201,6146,6148,4204,4674,1183,1565,2274,2597,858,1618,1417,1476,4320,4262,4615,4648,4291,4366,5137,473 7,3091,2586,478,968,1260,383,2435,2356,5132,4619,4371,4676,1212,910,1801,815,2264,2464,1579,976,2319,232 7,870,1684,1633,917,2206,2385,2598,2720,3140,2166,1337,1241,2380,2627,1606,1824,727,1150,1442,493,1357,1 251,2588,3120,1676,873,2437,2221,1384,701,4387,4155,6152,6160,3085,2169,1566,931,4265,4656,4210,4373,132 3,1798,1365,1473,2601,2247,756,1334,860,499,2832,2227,731,1648,1238,823,4252,4183,5248,4293,1575,922,119 9,1674,4212,4266,4157,5138,2276,2386,874,1432,1421,918,2360,3584,4627,4621,4738,4377,2752,3202,1636,1254 ,2438,2222,502,1795,2602,2629,933,1366,4

374,4622,4273,4389,3094,2441,1338,1682,2331,2170,2496,2401,1587, 1211,1488,743,1358,760,2609,3144,1244,1581,881,1147,4484,5153,6176,6147,2251,2111,494,1379,4187,4680,486 5,4294,1272,702,2388,2442,3097,3329,921,1624,501,876,2575,2630,1415,847,1856,1444,992,1697,2604,2229,426 8,4216,4297,4432,2343,3107,2333,2280,447,1607,1436,1369,2172,2253,1257,1704,2230,2691,733,1797,3204,2610 ,1669,1340,1231,827,1590,934,4158,4378,4239,5125,2334,2633,1634,1474,5140,4199,4274,4390,2347,2402,3093, 2259,882,937,2449,3152,2233,3109,963,1419,747,1265,2444,2392,4189,5154,4740,4298,4688,4419,4488,4393,111 9,505,1381,855,2634,2693,924,1810,3330,2641,2583,2288,6149,6208,4866,4203,3098,2254,734,829,1563,1213,21 43,2375,4276,5376,4247,4305,1611,1363,2612,2848,1430,1258,1688,1386,965,1614,1730,1239,2450,2404,938,884 ,4380,5123,4744,4190,506,1327,1589,1804,2355,2349,2465,3208,749,1370,2261,3114,4300,4394,4496,4704,2616, 3168,1640,945,2880,2636,966,1456,1681,755,3083,3585,2234,2694,1266,859,5185,4448,4421,4629,2452,3139,227 5,2944,4251,4306,4401,4643,2642,2466,1427,1593,1388,940,2350,2697,1214,830,2819,2408,4396,4205,5144,4280 ,1809,911,1621,1582,4630,5156,4633,4211,2587,2159,1832,871,3100,2379,639,1480,5186,4263,4321,4422,1698,1 335,888,1372,1245,479,1422,1268,4402,4868,4253,4752,3216,2262,946,1732,2357,3110,1677,750,1802,1626,3332 ,2236,4425,4206,6153,6150,4213,4308,4267,5134,2497,3121,1393,969,2265,2456,2657,2644,508,1613,2599,2698, 4872,5160,4426,5249,2277,2207,861,1446,2468,2358,1857,1339,3141,2589,757,1382,3336,2821,970,1700,2658,27 05,2381,3113,1243,919,2167,3146,1594,1433,1826,1504,875,1635,1259,862,4322,4645,5139,4634,2648,2387,1920 ,1675,4483,4404,4312,4512,4367,4375,6161,6154,3232,2266,1445,758,4254,4433,4646,4768,2416,2700,1149,948, 1359,1816,3079,2278,1596,1671,1712,977,5188,4214,4428,4675,4636,5168,4485,4269,5133,4217,4649,4295,2439, 2361,1385,923,1622,972,2498,2590,1434,1311,3586,2382,4880,4275,4324,4434,1729,761,1396,877,3124,2281,260 3,2822,2223,2171,3203,2706,1207,1475,2660,2389,1449,1812,952,1686,2825,2268,495,1262,2362,3153,1644,1619 ,2472,3116,1341,1429,2443,2721,1825,703,6162,6272,4408,5632,1371,1638,1567,1736,4800,5250,6156,6177,2631 ,2403,935,1685,978,1625,3344,3142,4486,4270,4650,4677,883,762,1246,503,5142,4489,4379,4218,2335,2231,145 8,925,4544,4449,4657,5192,4299,4159,4436,4490,1394,1269,2282,3099,5145,5377,4623,4678,878,1478,735,1799, 4652,4277,4391,5155,2173,2605,3264,2708,2664,2390,1678,1860,2364,3205,2289,2826,2611,3122,1443,1637,438 1,4328,6209,6164,2393,2500,1481,1373,2445,2451,3160,2255,1699,1255,993,1591,1828,1452,3588,2722,885,939, 994,1400,2606,2833,3148,2480,4220,4301,4278,4739,1744,1656,3087,2405,5252,4658,6400,6178,2235,3210,980,1 689,926,764,2284,2712,1270,941,1628,1367,1805,1457,3360,2672,4382,4681,4395,4450,2635,2828,3128,3170,514 1,4307,4497,5200,1921,1583,2753,2174,1387,1642,2290,3111,967,1267,2613,2446,4281,5157,4492,4440,1484,145 0,2394,2504,4682,4741,5378,4689,886,831,1683,1342,4631,4336,5146,4302,1811,947,2406,2453,2351,2617,3592, 2292,1705,1431,3206,3145,2643,3331,507,1261,1840,889,2237,2614,4191,4423,4660,4896,1650,984,1760,1490,61 68,6180,4498,4452,2724,3217,3102,3156,1615,751,2409,2754,2637,3392,2263,2834,6151,6273,4403,4397,1702,94 2,1858,1423,2695,2396,1460,1383,4513,5256,4309,5162,2467,2454,996,1692,1641,1814,971,1477,2512,2728,1273 ,1512,1733,890,1598,1374,4664,5216,4928,4684,2849,3117,2410,3212,509,1806,2638,2457,5131,5633,4282,4742, 3334,2618,1922,1649,4500,5187,4323,4992,3169,2836,3600,3154,949,973,2645,3123,2620,3234,1397,1489,4690,4 514,4398,4745,2267,2359,2756,2646,6210,6656,4867,4456,4635,4207,5148,4427,3337,2649,1708,1627,2699,2469, 1000,1690,2840,2850,892,1274,5264,4310,6155,6184,2659,3095,1438,1817,2650,3220,2458,2279,4405,5158,5380, 4284,1390,1464,2736,2701,1868,950,1151,1731,4545,5169,4313,4504,1506,1827,1597,863,3176,2296,3118,2417,4 705,4692,4647,4746,1451,759,2238,2412,1864,1714,3616,2702,3143,2707,1701,1395,4325,4255,4516,4406,5189,4 637,6212,6274,3209,2383,2528,2363,1803,1008,2269,2418,3333,2661,1623,1482,5384,4869,4706,4753,3456,2470, 1276,510,4429,5161,4215,5194,2473,2499,1435,1652,4696,4435,5280,4314,3125,2662,2591,3346,2283,2460,2391, 2420,979,1492,3233,2823,4464,4748,5127,4326,953,1928,1829,1389,4487,4409,4546,4638,2365,3587,1738,763,22 70,3147,1872,974,5634,4430,6163,6157,6192,6158,5172,4329,2474,2501,1453,1643,2285,3172,1713,1818,4651,48
70,4271,4219,1215,1402,2607,3218,1629,1520,1830,1691,3340,2881,954,1459,5251,4754,6216,6401,4708,4437,48
73,4316,4410,5201,4520,5164,1734,879,2852,2760,3130,2882,981,1505,2709,3101,1706,982,4491,4769,4679,4451 ,2856,2827,3265,2665,2652,3589,2481,2768,2864,3149,1924,927,3224,2884,1833,1639,2395,2945,3184,2291,1447 ,1746,3345,2710,1343,1679,3648,2502,2366,2723,1820,1761,5392,5190,4383,4279,4330,5147,6165,6276,1479,127
5,995,1740,4221,4653,5312,4756,4712,4438,6179,6402,3158,2666,1401,1888,4412,5253,4337,4874,765,956,3129,
2946,2829,3362,1496,1861,4659,5170,4441,4548,3268,2424,887,1437,4493,4499,5208,4303,6170,6657,5636,4770,
4654,4881,5196,4528,985,1720,2476,3594,997,1630,1813,1462,5135,4453,4283,5258,2713,2784,2615,3155,4332,4
760,5408,4720,3240,3126,1398,1645,2888,2673,2286,3207,2407,2505,2447,2835,1848,1687,2639,2726,4683,4876,
5176,5218,1247,1716,2482,2725,3338,3590,1936,986,1483,1651,1745,943,2397,3348,1859,1508,3150,2293,3236,2
506,6224,6181,4801,4222,1834,1454,2714,3161,4338,5159,6169,6166,2668,3601,891,1841,998,1595,3211,3361,46
61,4494,4442,4552,1278,766,1465,1709,6280,6404,4454,4501,4399,4665,5640,4340,2411,2175,1764,1646,5254,51
93,4691,5379,4285,4662,4772,5265,3115,2239,3173,2830,2455,2484,1737,511,5150,5204,4457,4802,2674,3266,14
85,1404,4685,5440,4311,4882,2619,2513,1693,1866,2729,2294,2755,3394,4743,4444,6408,6182,1952,1491,988,16
57,4515,4502,6658,6240,1752,1807,2398,3132,2647,2716,3596,2838,1399,1844,3213,3368,2508,3171,1001,951,16
54,1926,3248,2297,2730,3712,1707,1391,4560,4776,6211,6185,2621,3219,2459,2851,4897,5165,4458,5260,1002,1
468,3164,2837,3352,2757,2413,2488,6288,6172,4686,4505,1836,1494,1873,1271,2676,2737,1694,893,5382,4666,5
217,4884,2422,3272,1923,1461,2471,3604,1748,1715,5648,5202,4693,5171,2514,2841,975,1862,4668,5282,4315,4
407,894,1815,3178,2298,2419,3222,1497,1653,4804,4694,5385,4697,4747,4517,4888,4898,6213,6186,4707,5143,2
529,2622,3396,2461,4698,5268,4506,4327,3157,2651,2414,3593,1510,1762,3335,3103,2516,3618,1842,1375,2703,
2948,2853,2663,4784,4749,6660,6193,3214,2732,1703,1009,5224,4344,5166,4465,3457,2758,1466,1874,6
218,641
6,4286,4460,3235,2477,955,1739,2842,2300,3162,2421,2653,3280,2896,2738,5664,4750,5191,4755,1486,1930,276
1,2680,1889,1004,1658,1821,5257,4431,4576,4411,1718,1929,3364,2530,2854,3180,1599,1507,3131,2475,1776,14
05,3225,2952,3617,2462,4317,4466,5381,4709,1735,1831,3339,2271,3174,3602,1493,1010,5504,4518,6304,7170,4
521,4547,6664,6432,2711,2740,2883,3376,5173,4710,4639,5394,1984,1455,2667,2520,4331,4508,4439,4468,957,1
865,3185,2503,6672,6336,5281,4871,2844,3237,3649,2857,4413,5635,4318,5195,4522,4549,4333,5220,2762,3296,
2769,2885,2764,3134,983,1710,3350,3400,958,1514,4655,5266,6688,6214,2912,2858,3221,2654,1876,1768,3242,2
960,5388,4929,4900,4808,1721,1938,3151,2770,2744,2425,1660,1500,5178,4930,4757,5149,6188,6275,6225,6194,
1403,1892,3472,2483,1819,1741,1516,987,4904,4875,5313,4713,3341,3608,1932,1463,2865,3177,3840,2367,1012,
1843,2669,3228,4700,5637,4529,4816,4912,5197,6217,6159,5272,4932,4443,4993,1749,999,2860,2532,3393,2478,
3620,3186,5232,4339,5393,4758,3347,2886,2715,3267,5696,4550,4414,4771,1838,1277,2536,3159,6464,6277,520
6,4714,2287,2426,2507,2670,3458,2675,1647,1925,2485,2428,1498,1742,5177,4994,4877,5410,3249,3656,2866,32
26,5316,4472,4524,5642,6196,6167,4761,4832,1513,1880,1717,1016,4663,5203,6278,6528,5288,5174,6220,6281,1
953,1837,3342,2509,1867,1631,3591,2544,4936,4721,4334,5255,2717,3238,1469,1747,3365,2727,767,1904,4455,4
553,4495,4883,1724,1524,3188,3127,6226,6200,4687,4774,4530,4773,5386,5638,6171,6241,4445,5396,989,1406,1
754,1822,3269,2772,2889,3353,5198,4341,5284,4554,2677,3632,2399,2515,4762,5209,4716,5649,3408,2486,3163,
2785,2299,2510,2490,2489,1835,1499,3714,2517,3597,2295,2731,3244,5259,5409,4459,4223,1944,1863,1890,146
7,1003,1522,3274,2890,3460,3175,2786,3192,5163,4287,5221,4878,4503,4532,6183,6403,1763,1695,3356,2947,47
22,5314,6228,6282,4667,4561,6289,6405,3650,2718,1850,990,4777,4342,4803,5442,1005,1937,3366,2831,3133,28
97,1722,1845,6173,6187,6242,6659,4446,5180,4695,4764,3603,3241,1495,1655,5644,4886,6232,6284,5261,5416,4 556,5219,5296,4345,4778,5760,2868,3624,2776,2976,2839,2415,1765,1956,4669,5267,4507,4899,3424,2949,1487,
1750,5212,4885,5400,4805,3281,2678,1869,1521,3369,2733,2892,3252,4461,4536,4724,4785,2681,2759,959,1896,
6174,6290,4470,5320,1263,1940,3166,2301,2739,3349,2872,3223,1770,1877,2950,2734,3716,3270,1509,1711,346
4,3181,2788,3395,7172,6215,4519,5652,1756,1846,2898,2423,4562,4889,6406,6409,3606,2492,1011,1960,3354,25
18,3215,2531,6305,6720,5226,4346,4467,5270,6189,6244,3595,2463,1784,1870,4577,4670,5444,4509,5205,4699,4
462,5641,1662,1013,2533,2953,5383,5151,4564,5666,4751,4996,4901,4711,1985,1753,3250,2843,5262,4780,5505,
4806,2521,3288,2682,2792,6784,7169,5283,4525,1927,1528,3664,2900,6195,6292,4890,4348,1849,1882,3008,337
0,5210,4469,4701,5328,4944,4786,6190,6219,2913,2741,1766,1511,4809,4728,6410,6417,3179,3842,3398,2845,32
73,3652,3619,2954,1954,1719,3300,2763,3189,3378,1777,895,5412,4578,4902,5228,2855,2522,2684,3227,6661,62
48,5179,4523,2742,2302,1439,1006,5273,5000,5665,4510,3598,3713,1878,1891,2765,3119,3363,2623,6306,6197,5
387,4319,2961,3488,2846,2859,2427,3256,1939,1661,5222,5650,4759,4788,3401,3239,1502,1986,2745,3612,1852,
1934,4931,5424,4715,4568,2479,3190,2655,3276,6337,7176,5233,4551,2537,3372,1723,1772,2914,2771,1515,189
7,6296,6221,4892,5285,5697,4905,4810,5344,4817,4933,4812,5182,6308,6912,5398,5448,2534,3621,3229,3282,49
60,4906,5269,4702,2956,3841,3609,2766,1014,1470,2861,3412,5290,5008,5199,4818,1743,1931,2524,2904,4792,4
473,6412,6418,3165,3459,2887,3377,5520,4531,6662,6198,3343,3194,2773,2746,5389,5656,4913,5225,3520,2962,
1017,1968,3297,2800,2916,2867,3397,2862,2487,2977,5888,4415,4717,5276,1881,1894,3245,3626,1769,1517,253
8,3187,6227,6201,6665,6256,1778,1941,1823,1659,3728,2671,1992,1875,4908,4580,5441,4526,3680,3384,1755,15
01,2719,3246,3410,2787,5668,5234,7168,6279,1018,1900,3651,3605,1725,991,3461,2964,5395,4934,4763,5315,62
22,6433,4584,5207,4335,4474,4555,4718,3351,2511,3284,2891,5506,4723,6338,6229,4533,4476,5297,5704,4914,5
274,6420,6666,3183,2429,3720,3402,5390,4557,5639,4592,2545,3634,2978,2869,4765,5286,5413,4775,6202,6312,
5236,5175,2774,3009,3251,3230,1933,1839,2920,3466,2540,3298,3380,2679,6283,6243,5317,4820,1525,1955,198
8,1884,1726,1948,3622,3271,4937,5401,4725,5680,6230,6204,4447,4563,2777,3193,3653,2748,6424,6233,5456,45
34,5211,4833,6434,6673,1780,1518,3844,2491,1020,1767,1905,1851,4347,4558,4538,4537,3355,2789,1893,1945,3
426,3610,3404,3253,2893,3367,2968,2430,6668,6340,5762,4565,5645,4343,4779,5292,6285,7184,6245,6291,3633,
2870,3473,2899,5322,4938,5508,5223,3277,2778,3657,2546,4834,5240,6320,6286,1757,1530,2928,3304,5404,499
5,5698,4766,2790,2493,3440,2519,5414,4879,5181,4945,1958,1471,1007,2000,2683,3196,3744,2980,3628,2735,18
47,1898,5651,5289,4916,5672,4824,5024,4887,4463,6674,6465,5472,4997,3258,3468,3660,3373,6175,6344,6234,7
200,5329,4726,6689,6436,1523,1942,3848,2951,3182,2873,1961,1871,5417,4781,4940,5300,3283,3409,1771,1529,
2548,3625,2894,3718,4729,4807,6466,6676,6407,6293,6246,6249,3243,2793,1912,1758,5214,4349,4787,5397,492
0,5271,6448,6440,4998,4782,5764,5318,2874,2780,1989,1946,3312,2494,3010,3474,5512,5229,4836,5443,3668,29
84,3425,2523,4946,4471,5654,4540,1526,1906,2901,3358,2915,2685,3599,3278,1883,1773,3462,2955,5402,4566,5
263,4579,3254,3715,3636,3381,2535,3856,1957,1853,2743,3489,3135,2794,5643,4511,7174,6307,4581,5001,6236,
7177,1976,1015,2876,2801,5298,4891,4569,5336,6191,6411,4730,4840,3658,2902,3285,3374,6529,6690,5712,494
8,6468,6352,6530,6294,1751,1993,1503,1962,5056,5418,6297,6309,4961,4789,6250,6199,2905,3416,3257,2552,52
27,5890,5446,4893,5321,5700,5667,5002,6472,7232,5348,4811,2847,3403,2303,3012,5237,5426,4903,4570,1781,1
885,3290,2957,4732,5275,4790,4350,1908,2016,3721,3607,5646,5761,6680,6721,3357,2767,3191,2525,4813,5167,
6692,7178,5411,4671,5009,5536,3665,2963,3496,3428,4894,4907,4475,5304,2686,2796,1854,1532,2992,3776,337
9,3275,2917,3640,3476,2539,2747,3301,1972,1774,6257,6298,5449,5287,6223,6413,4793,5660,3399,2802,1019,18
95,4527,5238,4703,5324,3231,3613,2906,3666,6252,6722,4585,5420,6368,6310,4962,4819,3465,3524,252

6,3016,6
663,6696,4582,5669,5277,5330,5004,5889,3308,2431,1987,1969,5657,4814,4909,5460,6339,6414,4572,4952,3260,
2958,3849,2863,7185,6785,5213,5507,3627,3024,1782,1279,4935,5425,5391,5242,2918,3732,3681,2965,7180,666
7,4821,4794,5568,5010,6419,6724,5345,4848,4964,4915,5445,4910,4535,5025,1943,1899,3385,3289,6435,6203,52
93,5674,1994,1663,3654,3872,2775,3198,3490,2541,4586,5235,6313,6704,3405,3299,1964,1785,5776,4719,6258,6
421,3724,2921,1021,1935,5728,5432,4767,5294,3432,2749,3614,2979,5458,4835,6300,6231,3371,3846,3413,3521,
2804,3382,2908,2547,5699,5653,7296,6341,2779,3696,3286,2871,3623,2970,3247,3722,6260,6314,5509,5012,188
6,2001,2922,3480,3469,2966,1407,1779,5399,4559,5332,4939,6205,7186,5231,4477,1990,1970,3684,3302,5768,54
50,6675,6669,2550,3843,1879,1022,4593,5682,5026,4917,6786,6425,4822,5057,5299,5278,6422,6670,4968,5514,4
588,5346,5428,4727,6321,6437,2981,3414,1902,1947,6532,7201,5670,5319,3386,3730,3635,3259,4825,5241,5701,
4796,6235,6728,5892,4539,3536,2791,3406,2808,6913,6342,5403,4837,3292,3629,2929,3195,6316,6264,5474,565
8,5452,5301,4941,5415,2542,3427,3320,2750,2969,3672,2549,2924,1759,1907,3463,2895,6345,6480,5016,4478,39
04,3492,3040,3745,1527,1996,1786,1959,6206,6426,5681,4918,5521,4947,6287,7173,2495,3655,3484,3417,7188,6
247,5325,4826,2002,1913,3305,3752,1949,2017,2781,3845,5705,4594,6322,6438,1534,1788,3717,3388,3279,2875,
3638,2982,4976,5352,4838,4541,5488,4567,6237,7202,6788,6346,6736,6467,3682,3522,2930,2985,4731,5244,579
2,5028,5676,4783,6536,6441,5306,5516,5708,5421,5896,4999,5230,4921,3011,3467,2795,3313,5331,5457,4596,56
73,3167,2553,3429,2903,4942,5766,5291,4841,6914,6251,6324,7424,2972,3858,1910,1965,2782,2877,3611,3261,3
659,3411,2004,1901,4922,4828,6295,6353,3478,3306,3736,3434,6428,7171,5360,4542,6792,6238,5058,5522,3013,
3662,3778,3287,5716,5032,6348,6442,5473,4571,6544,6752,1966,1775,2986,2932,2008,1531,2554,3375,7233,649
6,6469,6677,3637,3852,1971,1950,2797,3418,3688,2993,4949,5406,4963,4733,3014,3504,3729,2803,6299,6354,56
47,5326,6449,6691,5510,5003,5302,5763,5684,5429,3314,2907,1909,1991,4583,5904,6444,6253,3475,3641,3436,2
988,4791,5537,5183,4842,3262,2878,3857,2959,4924,4849,5706,4950,5333,5422,7192,6328,3669,3630,3880,2919,
2018,1727,2687,3528,3746,3383,2936,3420,4953,5464,6678,7204,5305,4600,4895,5451,6681,6259,4351,5060,329
3,2527,3470,3316,7234,6311,6369,6470,5338,5005,6450,6916,1916,1855,1974,1995,2994,3780,3725,2798,6301,68
00,5769,5655,5405,4815,6473,6254,3850,3674,3441,3017,5239,4573,6261,6356,5713,5011,5544,5476,2020,1977,2
556,3661,6315,7182,4734,4844,6920,7208,5040,5824,5427,5323,4965,5688,2909,3494,3905,3387,2805,3430,3018,
3748,5524,4587,4795,5349,3291,2967,1787,1914,5447,4850,6474,7297,3642,3481,3874,3552,5279,5661,6370,669
3,2923,3683,3307,2910,4954,5714,5513,5572,2005,1887,3968,3723,1023,1963,3493,2806,7187,6682,4574,5064,53
56,4479,6531,6452,3197,2996,3407,3864,5308,5006,5897,4911,6360,6560,5675,5072,6415,6423,4966,5780,5729,5
013,6302,6481,3644,3719,3760,3025,6694,6816,7236,6262,5433,5337,6476,6723,3433,2971,3670,3020,5702,5920,
4823,5246,5538,4589,5453,5347,6684,7216,5772,4969,3482,3359,1998,1783,6533,6317,5480,4797,3777,2809,344
4,2925,7181,6265,5662,5027,2024,1980,3255,3523,5419,5894,5461,5569,6697,6343,4852,5430,4956,4595,6928,63
23,4827,5744,5334,4919,3497,3860,3000,3734,5671,5018,5295,5770,2543,3310,1903,1973,3692,3667,3389,3477,3
873,2751,3419,3686,6372,6482,4970,5528,5517,5014,6456,7680,3615,3784,2983,3733,6848,7298,5732,5350,3026,
3673,2931,2810,6534,6318,4598,5891,6698,6725,5029,5462,3294,2551,3506,2973,7190,6537,5434,5778,6427,626
6,6592,6497,3442,3317,2003,1789,5683,5307,5584,4839,5454,4856,6705,7240,2926,3526,2783,3847,5340,5677,49
77,5243,1997,2032,3726,3908,6347,6207,4590,5475,5368,4798,6484,6538,7193,7425,5017,5720,4597,4972,6671,6
726,5511,4943,5952,5540,5088,5793,6700,6325,1978,1917,3491,3685,6439,7203,6429,6376,2010,1519,3529,3421,
4543,5703,5532,5465,6268,6349,5353,5800,3747,3303,3041,3639,6326,6787,4829,5893,3876,3500,2933,2987,730
0,6706,5765,5436,5327,4923,5686,5030,3042,3448,3

792,3704,3028,3737,2974,2812,6430,6729,5730,5570,3318,29 89,3676,3415,3853,3505,2019,2006,6443,6498,7189,6355,3969,3631,3435,3690,4978,5033,6545,7248,6329,7205,5 059,5515,1951,1911,3015,3315,4843,5361,6540,6488,3532,3498,2021,2009,5215,4601,5477,4951,6730,6789,5020, 5906,7426,6737,6679,6384,7194,6350,4830,4925,5659,5309,6239,6471,2934,2879,3731,3390,5707,5459,6708,694 4,5526,5354,5784,5482,5061,5710,5826,5335,6546,6500,5034,4980,3859,2995,3753,3479,4602,5423,5685,5900,25 55,3309,3888,2937,6451,6445,6561,7304,4845,5466,6357,7210,3698,3032,3808,3538,3663,2799,1790,2026,3750,2 990,3906,3471,6712,7264,5736,5041,3508,3431,3044,3740,6976,6732,5062,5552,5777,4851,7179,7681,3689,3862, 3019,3525,6330,6790,5362,4955,1975,2012,3321,3560,3781,2938,3646,3422,6548,7235,6371,7040,1967,1915,255 7,3854,3970,3697,2997,3021,6738,6562,5523,5689,5484,5036,6446,6793,5310,4926,6915,6504,5905,5007,5717,56 78,6683,6255,5928,4967,7196,6475,4735,5576,5794,5431,4984,5468,5341,4575,5518,5364,3445,3537,3756,3675,7 312,6358,5042,5828,6453,7206,5773,4846,5898,5722,7428,6332,3048,3738,2940,3322,3486,3865,3438,3512,2025, 2022,3916,2998,6593,7217,5489,5065,6361,6552,6753,6740,4604,5709,6695,6794,3199,3779,3554,3875,6373,630 3,4957,5542,6564,6454,5953,5435,3645,2911,1981,1918,2033,1999,3499,2807,7237,6685,4853,5478,7432,6917,50 66,5796,3912,3762,3749,3443,6754,6801,6477,7209,3851,3056,3671,3530,5339,5015,6263,7242,5690,5529,5922,5 600,4971,5731,5355,4958,3324,2558,3483,3700,6744,6483,6016,5771,3027,3540,3001,3976,7328,6362,5541,4854, 3877,3437,3786,2811,6512,6796,5245,5044,5455,5912,7175,6374,5692,5767,5808,5073,2028,1533,3920,3022,350 1,3691,3761,3866,6535,6457,5481,5019,5718,5068,6594,6686,5530,5407,7682,6478,3263,3450,3677,3568,5825,48 57,5492,4973,7220,6377,6699,6918,3878,3739,3002,3507,6319,6267,7299,6802,5303,5571,6756,6485,3782,2927,3 029,3553,5545,5908,5048,5782,6921,6364,4591,5358,2011,1982,3754,3030,6458,7249,5740,5715,6568,7212,5437, 5525,6539,6817,5921,4799,3972,2975,3881,3687,3495,3794,2034,1979,5467,5734,5663,5832,3391,3727,3 868,380 9,6727,6499,5031,5781,5074,5721,7440,7238,4979,4858,5342,4599,3527,3323,3043,3788,6431,6327,5554,5021,34 49,3936,2813,3004,5490,5365,6378,7195,4974,5574,4831,5895,3544,3909,2935,3485,6269,6701,7360,6804,6760,6 486,5774,5956,6460,7301,6385,6922,6707,7218,5539,5733,3033,3768,3045,3678,6489,6596,5577,5469,6541,6547, 7256,6351,3861,3510,2023,2013,5795,5351,5089,5687,5924,5548,7684,6818,4981,5035,5090,5496,3446,3693,203 6,2007,6702,6929,7244,6576,3896,3735,3295,3764,5840,5752,7183,6501,6331,7306,5076,5785,5022,4860,6380,68 08,5366,5037,5724,5463,5901,5553,7456,6768,3984,3034,3531,3699,6731,6924,7224,7266,3793,2991,3907,3556,6 017,5679,6849,6270,3882,3502,2939,3889,5483,5738,6386,7207,5063,5363,6709,6542,5580,5546,6490,6600,3046, 3643,3326,2814,4982,4927,5779,5438,3513,3757,3812,3694,5907,5043,6502,6549,6447,6713,7688,6388,5801,552 7,7302,7241,6739,7427,4603,5357,2030,2014,3785,2559,5936,4985,6333,6710,3533,3452,3741,3914,5746,5080,58 56,5586,6820,7313,7198,7252,5711,4847,6505,6850,6733,7488,6359,6930,5798,5038,5954,5519,6791,6492,5556,5 479,2040,1535,4000,3539,6563,6550,5092,5788,5737,5910,5067,5573,6608,6824,5369,5608,5829,4986,5694,5470, 3036,3705,3800,3855,6945,7213,6506,7308,3447,3892,3049,2999,4605,5902,6734,6553,3702,3974,3755,3439,305 0,3516,3884,3542,7430,6714,6018,5745,3921,3319,3742,2941,7265,6932,7696,7250,3971,3509,3796,3763,5045,50 69,6741,7219,6716,7330,5493,5585,2027,2029,3023,3910,6363,6455,6852,6742,2942,3863,2035,2037,7433,6745,5 804,5723,6795,6565,5096,5786,6936,6946,4988,5370,6755,7191,5534,5913,6746,7316,6554,6375,5486,5560,6832, 6797,5964,5046,5247,5827,5602,5923,5693,4959,7272,6392,7214,6513,3545,3701,3558,3810,5547,4855,6334,650 8,5960,5810,7712,6798,7239,6803,5797,5491,3890,3423,3751,3057,3514,3922,3003,3787,3534,3978,3937,3052,73 05,6479,6624,6459,5899,5104,6365,6514,7429,6757,5719,5578,3706,3869,3766,3977,7552,6566,5372,4606,1791,2 038,3647,3555,3824,3453,3783,3879,6569,6595,5531,5748,3541,3058,4032,3503,7221,6758,6687,7442,6379,6556,

6487,6516,5075,5588,7329,6919,5049,6024,5925,548
5,6461,7683,5834,4859,6366,7243,5968,5070,6570,6
597,554
9,5739,6381,7268,5809,5914,3005,3913,3031,3758,5
311,5498,6703,7314,5725,5616,5926,5787,7436,6977
,5050,55
55,3006,3562,3924,3816,2041,1919,3769,3986,5830,
4975,6948,6856,7226,6978,5077,5601,6805,7197,580
2,5078,3
708,3548,3451,3940,6952,6923,7361,6761,6748,7685
,6577,6864,3867,3789,3564,3035,6960,7245,6020,50
23,7320,
6980,5929,5735,3980,3511,3060,3891,6491,7041,728
0,6387,3797,3047,3886,3325,5543,5842,7441,6806,5
439,577
5,7744,6598,6462,6819,5916,5857,3695,3973,3546,3
790,5575,5371,5091,5836,3561,3928,3765,3064,7254
,6762,54
97,5984,4861,5052,7225,7042,6925,7458,5592,5957,
7364,6520,4983,5533,4001,3885,3915,3679,5081,581
6,6572,7
690,5093,5726,5909,5558,6809,6880,6711,7251,3517
,3795,2815,3952,7336,7222,5494,5741,6984,6769,63
82,7303,
6503,6601,6543,6931,5944,5783,6735,6822,3772,357
2,3037,3454,5343,5812,6578,6821,7434,7686,6032,5
082,380
2,3870,2042,2039,5579,5747,5841,5039,6493,7444,5
955,5604,7246,6389,7332,6602,3883,3547,3992,3911
,3938,35
15,3051,3570,5930,5550,6810,7257,6764,7697,4987,
5937,5094,5691,7307,7457,5374,4862,5561,5805,381
1,3743,3
898,3038,6507,6271,5860,5742,3053,3985,3770,3893
,7211,6335,7269,6926,6551,6580,5833,4607,6770,73
62,5581,
5500,6715,6609,5789,5962,6825,6390,6851,7490,604
8,5587,5084,5753,3543,3703,3813,4004,5848,5903,6
494,722
8,6743,6812,7692,6934,5495,5940,7309,7464,6604,7
267,5097,5047,5750,6022,7344,6393,3535,3798,3917
,3569,68
26,7808,5803,5487,2044,2043,3007,3944,6717,7315,
6555,6947,5098,5564,7260,6933,7448,6853,6509,658
4,5932,5
590,5969,5367,6772,6833,5790,4989,3311,3988,3818
,3925,6518,7368,6019,5557,6567,7700,5844,5811,66
10,6937,
5071,5958,3557,3759,3804,3894,4990,5911,7274,639
4,6515,7318,5593,5749,3059,4008,3832,3918,6625,6
718,749
2,6557,3710,3061,4033,3801,7253,6747,6510,7689,5
606,5858,7431,7199,6612,7714,5938,5471,6799,7044
,6949,67
59,3975,3576,3897,3930,7310,6828,5799,5105,2031,
1983,3814,3559,7553,6854,5562,5970,7331,6573,505
1,5835,6
938,6396,7258,6517,6749,7376,6992,6834,5582,6026
,6857,6776,5985,5100,5754,5917,5814,6025,7460,66
26,6950,
7276,5695,5603,7227,6571,5872,5501,7321,7048,771
3,6558,4002,3767,3825,2943,5831,5927,7435,6367,7
270,769
8,5589,5106,3487,3054,3926,3939,3987,3709,3550,4
034,6807,6836,6979,7472,6080,5551,6763,6616,3900
,3982,20
46,2047,5053,5961,7281,6599,3771,3820,3563,3945,
6940,7333,7745,6953,6858,7392,6865,6981,6860,723
0,5079,5
806,7446,7496,5054,5610,7008,6954,7317,6750,5972
,5864,7338,7056,5817,6034,7247,6866,6840,6521,57
56,5596,
5499,5988,7568,6579,5915,5837,5612,5083,3062,351
8,3791,3979,7437,7704,6028,5559,6961,7273,7936,6
463,510
8,5939,6765,7324,3065,4016,3929,3942,3817,3565,3
826,3989,5845,5095,6956,6628,7489,6574,7716,7282
,3871,37
07,4040,3923,7443,6982,6811,7363,3803,3549,3066,
3948,5934,5373,6632,7255,3773,3039,3981,3887,638
3,6522,6
603,6766,7554,6771,5743,6021,6581,6524,5594,5838
,7345,7752,6962,7322,5609,5976,5813,5112,6049,59
33,7438,
6605,5963,5727,7687,6640,6813,7334,5565,5843,746
1,6823,4863,6000,5820,5620,7284,7223,3573,4003,4
036,393
2,5085,5502,5850,5918,7365,6868,6985,7449,6773,7
728,6495,6611,3774,3996,3828,3566,7504,6582,7259
,6881,63
95,6606,6586,6585,5931,5595,7810,6613,7693,6391,
6827,7340,3068,3815,3953,3899,6040,5959,5986,556
3,3941,3
993,3805,3578,5099,5618,7370,6986,7556,7271,6882
,7288,4006,3519,3055,4048,5859,5791,7452,7043,77
46,6814,
5946,5086,5101,6033,7462,6927,7229,6993,5818,594
1,7699,7337,5591,5751,3895,3946,3571,3990,6964,7
720,687
2,7072,6935,6511,5861,6052,7520,7045,5583,5846,7
377,6774,5965,5617,7465,6829,6988,7348,6777,6855
,5055,59
92,4009,3919,3819,3577,5359,6036,7262,6397,6835,
7445,6968,7319,5866,5973,7046,6830,7812,7366,560
5,5807,7
560,7277,6884,7491,3960,3806,4037,3994,3574,3954
,3931,3821,5852,5942,6994,6519,7702,6588,5107,60
56,7450,
6614,7311,6627,7691,6559,5880,5966,4005,3901,402
4,3063,5758,5109,6629,7049,6081,5849,7346,6939,6
617,738
4,6778,6888,6023,5624,7760,6996,5945,5978,7104,7
466,7009,6837,5862,5607,3799,4041,3551,4010,7275
,7938,74
94,6941,7369,7748,7715,7050,6050,5815,7396,6859,
7285,7474,5873,4991,3829,3933,3956,4064,6951,661

8,6780,7 323,2015,2045,3902,3580,6838,6398,5535,5102,7694,7809,5974,5987,6861,7215,7459,6719,7057,7584,6942,6955, 6523,7352,6035,5757,7497,7335,5598,6082,6841,7708,5948,6030,6575,7286,6751,7372,4020,3822,3067,3943,663 3,7468,5819,5868,7010,6867,5611,5993,4035,4017,3830,3327,6630,7717,7325,7378,7052,7937,7705,6862,5110,55 66,6957,7508,5839,6027,6620,7000,3991,3947,4042,3711,7261,7555,6983,7473,7439,7290,6869,6842,7616,7058,5 113,6064,7393,6896,7012,6963,7493,6958,6583,7073,5977,5990,7341,7722,5865,5613,6634,7283,5874,6037,5919, 5755,7824,6767,6088,5971,7776,7480,5851,5597,6815,7342,7506,6883,4012,3833,3069,3983,5114,5996,7747,770 1,5821,5087,7557,7060,3934,4049,3455,3827,7447,6607,7380,6987,4038,4018,3927,3070,7279,6525,7816,7498,39 50,3995,3807,3955,6641,7730,7074,6965,6870,7105,7347,7326,6029,5935,7016,7562,6636,7394,7476,6775,5621,6 051,6084,5980,5822,6044,7718,7367,6873,7289,7749,6844,5876,5614,7940,6587,5116,5863,6001,5947,7451,6885, 5989,6041,7522,7706,7500,7349,6989,7463,7064,6526,3575,4044,3834,4007,7729,6966,7569,6995,7373,6874,775 3,6642,4050,3961,3997,4065,5853,5626,7024,7400,6886,6589,7536,6615,3582,3836,3958,4013,6054,5567,5103,60 96,6779,7292,7840,7076,7724,6831,5943,5994,7354,7564,7756,7469,5619,6038,7944,7047,7278,6969,6057,5967,7 379,7505,5867,5625,6644,7721,6990,7814,7339,6889,6008,5854,4052,3949,4014,3823,6970,6876,6085,6042,7408, 6590,7106,7570,7764,7080,7521,6619,5622,6002,6997,7454,7011,6781,7695,7374,5979,5869,7558,7051,4056,357 9,4019,3998,7350,7811,7732,7477,6631,7952,6053,5949,6839,7585,7231,6890,3957,4039,4066,3775,6072,5111,69 72,6897,7754,6998,7381,7470,5847,6089,5599,6058,7001,7512,7353,6648,6943,7499,6399,7108,5877,5981,7386,7 053,6004,6112,7817,7703,7453,6863,7287,6621,7761,7059,7592,7524,3964,3903,4022,4043,6782,6892,5950,5628, 7088,7872,7475,7371,7013,7736,7572,6635,6843,7397,6068,5870,4068,4025,3835,3962,4053,3935,3071,4011,749 5,6898,5115,5991,7327,7709,7002,7762,7561,7620,6622,7112,7404,6527,6083,6065,7356,7054,7945,6959,7723,71 20,5878,5375,7014,7828,7777,7061,6039,5995,7481,7385,6090,5759,7750,7968,6871,7294,7586,6637,7501,7395,6 060,5881,4046,3831,4072,4028,7820,7017,5117,6031,7528,6845,7710,7075,7467,7942,7509,7617,6900,7478,7004, 6643,6875,7792,7382,6967,7719,7066,7343,7818,5982,6097,7018,7576,7565,7062,5503,5875,6086,6066,7780,739 8,3951,4021,4051,3837,6646,7939,5975,5118,7077,7510,5998,6043,7482,7826,7731,7355,7632,6887,7502,6904,40 45,4080,4026,3965,7388,7725,7025,7291,6638,7523,7416,6846,7065,7768,6645,7020,5855,6003,7559,6991,8000,7 588,7136,7841,5623,6092,5882,6055,6591,7751,7580,7513,6098,6009,7401,7848,6045,6113,6877,7941,5630,5884, 7813,7484,7375,6971,7734,7078,4058,3567,4067,4054,7778,7618,7026,7081,3999,3959,4069,4057,7107,7563,689 1,7409,7263,6649,7525,6999,7068,7954,6006,6061,6878,6973,7707,7357,7755,7507,6100,5997,7574,7402,7832,75 30,7109,7758,7874,7383,6062,5871,7082,7028,6104,5627,6650,7471,7733,7948,6067,6046,6893,7514,7784,7089,7 110,7600,7825,6899,3838,4074,4023,4060,7410,7003,6005,6087,7571,7737,7532,7084,7358,6974,7953,7055,4015, 3963,4073,4070,7765,7726,7976,7015,6114,5823,6783,7624,7842,7479,7032,7516,7389,6623,7566,7412,6012,595 1,6070,6091,7090,7876,7821,6894,7946,7770,7537,7113,6116,6073,6652,7757,7005,7590,8001,7483,6901,7526,71 14,7844,7387,7063,5883,6010,7738,7577,7970,7648,7019,7779,7403,7006,4029,3966,4081,4047,6101,5983,8064,7 819,5119,6059,7589,6902,4076,3581,4059,4030,7293,7092,7503,7960,7740,7815,7856,7121,7529,7067,7766,7116, 7578,7455,6094,5879,7873,6905,7540,7021,6120,6076,7351,7619,7593,7956,7096,7830,6639,7406,5999,6069,778 8,7763,7485,7573,7969,6847,7515,7782,4082,4027,4071,4061,7711,7880,7079,7829,7122,7769,7027,6906,7390,66 47,7602,7069,7538,7413,6099,5885,7022,7622,6879,7943,6093,6128,7822,8004,6074,6013,7587,7781,6106,5615,7 625,7517,7843,7399,7137,7735,4084,4055,4078,4062,7972,7596,7029,7083,7138,7544,7888,7800,7124,7833,7070, 6908,7414,7085,7772,7511,7949,7601,6115,6102,8065,7727,7531,7786,6047,6007,7111,7411,7628,7594,6117,610 5,7030,6975,7827,7486,7955,7091,7849,7575,6651,7

405,7984,7033,7794,7128,7904,7634,7759,6895,5886,6122,7846,7086,8002,7567,7604,7527,7140,7836,7785,7958,7115,7621,6071,6108,7417,7656,7877,7034,7742,7518,6063,6011,6653,7950,8066,7793,7093,7117,4088,3583,4075,4077,7541,7633,7852,7771,7144,7834,7036,7418,7582,7961,7534,7608,6121,6118,8012,7094,7295,7875,7650,7971,7741,7007,6077,6014,6129,6095,7595,6903,8008,7858,7845,7539,7947,7152,7767,7626,7420,6654,7579,7796,7123,7636,7097,8072,7973,7533,7882,6907,4083,4085,3839,4086,6124,5629,8016,7118,7597,7787,7857,7962,7359,7546,7773,7664,7974,7835,7098,7603,7878,7023,7125,7649,6107,6078,7850,7126,8068,7071,7977,7783,7591,7890,6130,6075,7487,7823,7964,7905,7623,7419,7139,7884,7545,8032,6909,7100,4089,3967,4090,4087,7640,8005,7031,7581,7129,7864,7141,7774,7957,7606,6119,6109,7542,7789,6132,6103,7992,7831,7391,7860,8080,7130,7627,7795,7889,7087,8003,7652,7978,7598,7035,7985,4092,4091,4079,4031,7142,7739,7422,6910,7609,7853,7908,7790,6126,6110,7881,6655,7629,7548,7837,8010,6136,5631,8096,7635,7132,7801,7896,7951,7543,7988,7145,7095,7798,8070,7851,7535,7146,7612,7980,7638,8017,7415,7838,7037,8067,7605,7892,7859,6123,6125,7119,8006,7038,7959,6131,6133,7641,7797,7654,7906,7986,7519,7847,7153,7610,8018,7099,7883,7630,8074,8033,7148,7802,7965,7862,8073,5887,6134,7743,7651,7920,7549,7879,7975,7637,7154,8128,7599,7101,8009,7127,7854,7102,7658,8020,7912,6137,6015,7865,8082,7804,7644,7547,8036,7963,7885,7660,7131,8076,7607,7156,7987,7893,7143,7982,7421,7791,8069,7642,7886,7657,8024,7861,7160,8097,7981,8011,7775,7613,7891,6911,8048,7868,7668,7133,7550,7898,7966,6138,6135,7979,7643,8088,8007,8034,7611,7147,7666,7907,7839,7994,7134,7149,8081,7866,7989,4094,4095,4063,4093,7639,7799,7909,8100,7631,7894,8013,7665,6140,6139,7103,8040,7407,8084,7914,8021,7653,7855,7900,7990,7155,8104,7928,8014,7806,7157,8129,7897,8071,7672,7993,8026,6127,6079,7910,7655,8098,7863,7921,7039,7583,7150,8022,8035,8083,7805,7646,8130,7996,8078,6142,6143,7867,7916,7659,8041,7158,7614,7887,8075,7161,8112,8025,8038,7913,7661,7922,8085,7967,7803,8136,8019,7899,7645,7162,8044,7869,7135,8077,7983,7669,8099,8132,8028,7870,8092,7924,7662,7164,7911,8049,7995,8037,8089,7901,7674,8102,7615,7151,8144,7991,8042,7667,8086,8105,8015,7915,7673,8056,7902,8133,8090,7670,8050,8027,7917,8101,7997,8120,7159,7895,8137,7647,8106,7925,8029,8052,8160,6111,6141,7998,7676,8116,7918,7163,8039,8131,8113,7926,7423,8087,8043,8138,7807,8108,7929,7165,8079,8030,8145,7551,7923,8134,8114,8023,7166,8046,8091,7903,8051,7671,8140,7930,8103,8146,8057,8093,8161,7678,7932,8054,8109,8148,8045,8110,7919,8152,7675,8115,8094,8053,8135,8162,7871,8060,7999,8118,8139,8164,8121,7931,8058,8149,8031,7167,8107,8142,7927,8168,8124,8047,8117,8147,7933,8141,8176,8122,8061,8154,7663,8163,8150,8095,8055,8165,8153,7934,8170,8119,8156,8111,8059,8169,8166,8125,8062,8177,8143,8172,7677,8155,8126,8178,8123,8167,8157,8180,8151,8174,8158,8184,7679,8171,8173,8179,8181,7935,8182,8185,8063,8186,8183,8188,8187,8175,8127,8190,81 91,8159,8189]

**Sequence group 8: Z8_8192**

[0,1,2,7,3,8,11,24,4,10,13,28,16,33,35,77,5,12,14,32,19,38,47,81,22,46,42,88,57,96,102,168,6,17,21,40,23,45,51,90,29,55,59,97,72,110,116,186,34,61,75,114,80,123,135,197,87,137,148,225,153,238,264,385,9,18,26,54,30,58,71,105,36,76,62,117,84,127,142,206,44,74,86,136,92,145,152,233,100,155,170,252,184,272,291,432,53,89,98,151,111,162,178,269,121,179,196,283,210,305,321,473,139,204,230,311,236,324,349,510,257,357,379,535,400,564,607,863,15,25,31,73,39,79,82,141,48,85,93,150,101,160,165,266,56,94,103,163,115,177,193,286,126,194,205,300,232,318,344,493,64,108,122,183,128,195,213,313,149,228,237,326,256,355,373,534,164,246,270,361,284,393,402,559,307,420,458,594,483,628,706,869,69,124,144,216,159,235,255,359,169,258,275,384,292,401,431,583,191,287,301,413,325,446,477,642,338,486,515,674,543,716,750,1007,212,314,332,462,362,492,519,695,397,531,560,740,596,754,830,1096,429,574,608,793,623,849,885,1161,701,905,943,1152,979,1229,1319,1690,20,37,41,91,49,95,1 06,176,50,107,118,187,132,207,217,340,63,119,133,2 22,146,231,244,341,154,243,265,378,288,396,408,55 8,67,143 ,156,224,173,247,271,394,181,279,293,410, 304,443,466,620,180,302,316,442,337,480,495,675,3 66,521,544,715,57
2,748,798,1069,78,167,174,277,190,298,315,433,198, 320,330,475,350,508,525,713,259,345,363,513,386,5 41,569,7
42,423,578,614,786,645,846,892,1142,297,381,411,5 51,439,593,618,832,471,634,658,862,707,920,954,12 03,516,7
03,717,944,743,981,926,1249,813,1057,1097,1338,11 09,1459,1527,1769,83,188,192,336,248,354,372,520, 278,377,
387,548,422,580,613,834,294,414,438,581,460,619,6 49,872,487,663,694,910,741,951,1003,1265,339,444, 465,648,
494,685,725,930,546,728,752,999,814,971,1079,1356 ,591,778,840,1061,873,1108,1147,1414,921,1155,115 4,1507,
1251,1551,1611,1944,380,484,522,729,579,753,797,1 019,615,833,851,1098,902,1117,1153,1453,652,881,9 36,1143 ,958,1159,1257,1553,1015,1278,1315,1621,1 382,1713,1766,2133,714,948,993,1259,1077,1268,13 70,1648,1094,13
62,1424,1733,1486,1805,1910,2294,1119,1472,1541, 1837,1590,1924,1874,2335,1685,2001,2048,2498,216 8,2568,2
703,3011,27,43,52,99,60,120,134,214,66,138,147,221 ,158,241,245,390,68,157,166,240,175,299,308,428,20 0,310,3
35,472,352,497,523,738,70,172,189,303,202,333,346, 490,215,358,374,532,392,565,588,756,229,382,405,5 76,434,6
12,629,820,448,621,665,880,672,908,949,1333,109,2 01,211,351,223,375,391,550,253,409,424,600,451,64 0,662,83
8,276,427,464,626,489,670,681,894,512,683,692,953, 776,982,1051,1358,295,488,506,690,540,719,737,963 ,568,77
5,803,1014,854,1070,1099,1429,599,829,876,1105,92 2,1138,1213,1489,989,1220,1282,1568,1316,1631,17 22,2122,
112,219,242,403,274,425,459,644,290,467,491,684,5 17,697,709,960,319,507,537,711,567,766,795,1010,5 97,818,8
52,1090,895,1120,1187,1434,347,549,587,799,630,84 1,839,1123,653,884,906,1162,965,1217,1237,1573,69 6,923,9
85,1230,1011,1297,1318,1656,1056,1350,1403,1734, 1503,1815,1917,2307,368,606,635,886,680,919,967,1 221,763,
988,1034,1311,1038,1328,1377,1709,779,1036,1055, 1367,1135,1402,1478,1802,1200,1500,1539,1840,160 5,1954,2
018,2362,819,1149,1176,1437,1242,1511,1550,1895, 1283,1595,1659,1988,1723,2056,2147,2521,1409,166 5,1741,2

073,1834,2186,2227,2665,1897,2273,2333,2743,2429 ,2868,2981,3454,129,254,282,470,317,505,533,747,3 28,542,5
75,773,601,810,871,1189,360,589,643,835,667,917,8 97,1202,686,937,978,1277,1030,1303,1336,1686,435, 656,687,
911,762,962,994,1314,772,1033,1049,1337,1076,137 8,1413,1779,780,1066,1112,1411,1198,1475,1531,18 43,1232,
1583,1604,1961,1664,2019,2101,2477,450,761,765,1 012,785,1037,1089,1392,828,1136,1173,1455,1218,1 518,1592 ,1929,984,1191,1248,1533,1287,1628,1667, 2003,1383,1680,1752,2079,1836,2178,2207,2655,104 8,1296,1366,1630 ,1410,1730,1786,2119,1484,1811,1 858,2204,1925,2275,2360,2793,1548,1902,1980,2332 ,2043,2404,2476,2882,213
0,2501,2557,2970,2622,3099,3124,3759,463,787,809, 1185,961,1207,1236,1581,1001,1269,1307,1639,1374 ,1701,1
777,2109,1053,1334,1405,1717,1451,1789,1861,2197 ,1526,1922,1849,2259,2006,2343,2428,2819,1201,14 15,1474,
1823,1571,1878,1963,2322,1617,1981,2042,2405,209 7,2433,2533,2947,1726,2067,2142,2485,2235,2588,2 645,305
9,2290,2732,2778,3190,2869,3268,3298,3622,1292,1 479,1614,1986,1691,2036,2070,2460,1767,2163,2190 ,2550,22
61,2589,2747,3118,1783,2243,2324,2724,2426,2798, 2803,3294,2509,2896,2943,3339,3038,3476,3551,394 9,1932,2
398,2406,2850,2546,2900,2972,3369,2618,3058,3080 ,3520,3209,3556,3775,4114,2689,3175,3243,3662,33 52,3689,
3860,4249,3427,3894,3944,4370,4048,4478,4543,494 4,140,113,65,289,104,267,182,518,125,185,203,456,2 20,356,
327,592,161,218,239,334,268,412,376,691,306,388,4 30,561,474,767,632,957,171,249,273,395,309,421,48 1,609,32
9,509,447,868,547,657,702,1329,353,485,577,671,53 0,736,825,1127,602,808,764,998,893,1190,1039,1658 ,199,296 ,312,461,348,496,557,710,383,625,511,751, 590,781,848,1054,415,545,669,821,633,952,802,1095 ,582,853,980,114
8,916,1386,1228,2000,449,666,603,903,755,870,1008 ,1175,700,1067,942,1300,995,1241,1582,1458,792,10 18,1081 ,1425,1126,1312,1357,1712,1177,1501,1395, 1903,1569,2234,1803,2646,234,331,369,536,404,573, 624,831,445,712 ,595,860,659,900,964,1258,476,631, 757,909,693,1050,945,1233,784,1000,1113,1317,107 1,1372,1481,1748,514,74
6,673,970,850,1031,1121,1347,824,1197,1052,1594,1 163,1422,1435,1850,904,1110,1276,1480,1219,1517, 1640,22
84,1339,1684,1576,1893,1776,2021,2100,2768,566,7 74,877,1091,812,1134,1239,1499,927,1304,1172,172 9,1359,1

538,1635,1960,983,1212,1373,1588,1454,1668,1842,2039,1279,1797,1700,2196,1900,2132,2334,2936,1035,1408,1487,1807,1310,1735,1871,2397,1549,1950,2033,2206,1768,2499,2295,3628,1610,1989,2078,2461,2135,2353,2432,3095,1916,2554,2623,2849,2702,3389,2980,4423,285,389,426,627,482,718,664,956,504,682,842,1006,760,1064,1116,1394,556,794,739,1088,847,1231,1042,1452,918,1137,1256,1510,1184,1708,1629,2265,598,861,811,1332,992,1122,1188,1519,901,1216,1293,1828,1363,1579,1669,2049,1013,1393,1313,1728,1488,1643,1835,2129,1433,1796,1886,2183,1959,2302,2479,2832,641,1078,887,1243,950,1412,1302,1740,1043,1346,1461,1687,1516,1806,1896,2236,1146,1589,1436,2029,1379,1830,1879,2435,1681,1947,2057,2312,2131,2391,2559,3163,1206,1620,1514,1911,1719,2002,2187,2539,1814,2258,2035,2456,2096,2735,2640,3067,1552,2162,2352,2675,2274,2594,2918,3052,2407,2862,2769,3332,3019,3227,3477,4522,724,966,1104,1387,1174,1450,1638,1928,1240,1754,1485,1987,1577,1860,2134,2535,1060,1532,1615,2094,1732,2303,2032,2493,1859,2201,2264,2710,1946,2883,2630,3774,1335,1657,1804,2382,1931,2226,2179,2828,1718,2288,2469,2664,2401,2758,2961,3261,2071,2437,2342,2779,2538,3107,2903,3347,2641,2982,3182,3519,3081,3450,3861,4113,1404,1831,1971,2285,1755,2551,2361,2848,2123,2390,2695,2944,2468,3018,3204,3602,1894,2595,2511,3037,2725,3242,3093,3574,2874,3130,3406,3505,3323,3935,3806,4274,2203,2799,2652,3223,2951,3642,3156,3739,2555,3424,3299,3830,3338,3913,4045,5157,2773,3611,3521,4148,3461,4016,4212,4624,3717,4163,4097,4761,4347,5509,4656,5805,367,457,524,749,586,777,843,1118,622,955,815,1264,896,1160,1324,1634,668,855,1009,1196,931,1441,1250,1707,1065,1376,1515,2020,1351,1749,1822,2314,708,1002,959,1306,1080,1371,1498,1848,1199,1591,1423,1782,1572,1901,2111,2453,1139,1530,1473,1892,1642,2050,1962,2399,1731,2095,2200,2973,2240,2654,2558,3222,796,1032,1186,1440,1305,1502,1800,1945,1111,1540,1666,2028,1578,2169,2037,2520,1286,1716,1753,2299,1616,2110,2260,2694,1923,2325,2149,2615,2434,2772,2901,3441,1432,1788,1970,2205,1870,2383,2313,2823,2066,2548,2457,2759,2298,2919,2995,3402,1841,2579,2508,2945,2711,3131,3060,3575,2417,3039,3210,3923,3322,3799,3688,4457,907,1325,1158,1641,1238,1958,1593,2241,1460,1706,1851,2215,1810,2146,2374,2833,1428,2072,1887,2478,1787,2323,2291,2929,2034,2427,2619,2775,2547,3026,3098,3537,1570,1933,2128,2396,2191,2674,2532,3174,1951,2492,2802,3066,2614,2983,3295,3643,2242,2762,2669,3111,2937,3426,3216,3753,2897,3316,3562,3826,3460,3948,4020,4829,1727,2272,2038,2647,2143,2556,2792,3236,2315,3010,2742,3191,2851,3337,3407,3868,2416,2946,2829,3451,3110,3368,3603,4272,3044,3701,3478,3934,3652,4096,4179,4612,2510,2839,3157,3536,2994,3594,3738,4049,3309,3912,3636,4162,3827,4221,4359,4757,3226,3758,3920,4523,4044,4308,4422,5007,3678,4471,4626,4918,4657,5103,5302,5968,1068,1375,1301,1875,1506,1955,1829,2363,1580,1778,2148,2688,2051,2436,2569,3045,1649,2108,2007,2484,2289,2902,2549,3125,2237,2631,2763,3336,2838,3211,3479,3922,1801,2306,2202,2653,2400,2734,2774,3237,2118,2822,2960,3504,3092,3437,3388,4005,2500,2971,3162,3353,3053,3563,3653,4122,2928,3724,3550,4051,3810,4235,4346,4861,1930,2182,2534,2950,2375,2875,3119,3517,2668,3269,3027,3440,2644,3610,3679,4155,2746,3094,3183,3927,3308,3637,3782,4542,3425,3908,3725,4220,4019,4309,4516,4941,2863,3208,3518,3783,3333,4058,3909,4371,3623,3831,4123,4449,3945,4727,4566,5050,3455,4050,4213,4613,4316,4798,4718,5225,4178,4645,4919,5345,4860,5149,5439,6037,2214,2452,2578,3106,2818,3403,3061,3716,2733,3217,3205,3869,3346,4004,3811,4479,2942,3557,3317,3798,3629,3921,4149,4448,3516,4059,4195,4567,4021,4648,4771,5224,3036,3436,3752,4017,3595,4234,4112,4627,3663,4154,4275,4945,4470,4719,4756,5344,3895,4403,4533,4770,4358,5051,4862,5332,4248,4889,5148,5587,5021,5438,5565,6373,3260,3700,3807,4402,4018,4194,4532,4799,3926,4273,4456,4863,4625,5120,5006,5441,4115,4517,4644,5102,4726,4940,5207,5679,4760,5235,5156,5564,5333,5663,5769,6800,4317,4649,4828,5206,4888,5234,5409,5662,5020,5408,5303,5872,5508,5873,5768,6372,5121,5440,5586,5882,5678,5883,5969,6179,5804,6036,6178,6285,6284,6801,6446,64

47,130,1
31,208,251,209,280,323,440,226,322,343,478,370,52
7,529,783,227,342,364,526,399,562,611,817,436,610,
584,844,
661,888,924,1208,250,371,407,570,437,605,647,874,
479,655,689,889,768,946,986,1280,528,699,771,976,
816,1005 ,1063,1299,837,1073,1124,1421,1141,1456,
1528,1909,281,398,468,654,498,688,759,929,538,782
,704,987,826,102
9,1092,1348,604,770,836,1072,878,1107,1140,1439,8
98,1145,1210,1504,1270,1554,1613,2022,651,845,89
0,1133,9
47,1166,1226,1537,997,1227,1298,1597,1360,1651,1
711,2117,1075,1344,1430,1689,1448,1714,1795,2198
,1513,18
21,1889,2281,1948,2368,2455,2993,365,441,499,769,
563,801,822,1083,616,827,879,1132,899,1164,1179,1
534,660 ,882,925,1167,977,1225,1291,1606,1028,129
4,1345,1632,1438,1704,1790,2177,726,940,1004,126
7,1040,1295,136
5,1697,1125,1426,1449,1720,1512,1813,1873,2280,1
178,1490,1542,1839,1598,1935,1952,2341,1671,1984
,2076,24
24,2151,2502,2666,3005,745,1016,1106,1380,1157,1
443,1509,1833,1209,1524,1561,1908,1618,1949,2017
,2395,12
89,1607,1633,1979,1715,2058,2141,2526,1780,2164,
2225,2600,2293,2690,2744,3239,1364,1698,1750,208
6,1856,2
176,2239,2635,1943,2277,2354,2720,2430,2760,2922
,3396,2011,2378,2458,2827,2491,2953,3029,3509,26
57,3063,
3127,3500,3193,3631,3773,4302,406,539,571,875,61
7,883,938,1224,646,939,990,1281,1058,1349,1381,17
84,705,9
91,1059,1406,1114,1431,1482,1785,1144,1477,1529,
1888,1608,1942,1968,2340,731,1093,1150,1420,1215
,1491,15
43,1940,1235,1575,1619,1976,1650,2053,2098,2488,
1234,1636,1702,2052,1771,2144,2181,2601,1862,225
7,2296,2
687,2376,2740,2836,3351,800,1205,1222,1563,1288,
1626,1699,2023,1308,1710,1742,2121,1798,2194,226
7,2685,1
525,1791,1857,2213,1918,2287,2373,2722,1991,2388
,2470,2824,2537,2948,3046,3490,1625,1891,1977,23
21,2041,
2419,2486,2924,2103,2522,2566,2992,2667,3086,315
4,3593,2232,2659,2691,3128,2723,3195,3104,3655,2
881,332
1,3397,3796,3405,3981,4067,4401,823,1284,1290,17
70,1496,1812,1872,2256,1574,1885,1919,2304,1990,
2392,246
3,2926,1622,1982,2040,2393,2084,2487,2545,3008,2
165,2571,2634,3074,2721,3147,3231,3677,1781,2054
,2093,25
44,2180,2617,2701,3108,2300,2708,2756,3225,2898,
3189,3373,3816,2411,2814,2938,3335,3009,3404,349
7,3902,3
087,3503,3502,4047,3661,4105,4197,4636,1890,2160
,2262,2709,2389,2757,2835,3271,2471,2925,2955,33
98,3056,
3439,3501,3965,2552,3025,3116,3491,3160,3507,366
5,4107,3263,3708,3765,4207,3870,4327,4390,4849,2
686,314
4,3219,3667,3371,3690,3848,4232,3390,3824,3914,4
355,4008,4463,4604,5048,3443,3988,4091,4499,4164
,4610,45
40,5089,4287,4705,4762,5284,4890,5346,5477,5771,
469,585,650,891,698,996,1062,1368,730,1074,1115,1
401,115
6,1463,1483,1926,744,1151,1204,1462,1223,1627,16
82,2010,1326,1688,1765,2116,1808,2185,2263,2718,
758,1214 ,1285,1637,1330,1751,1792,2170,1369,183
2,1876,2278,1934,2369,2408,2770,1427,1898,1957,2
380,2030,2462,250
3,2910,2064,2489,2577,3024,2592,3072,3145,3787,9
41,1327,1361,1799,1407,1877,1927,2320,1505,1969,
2004,244
4,2069,2524,2570,2930,1562,2009,2092,2496,2167,2
590,2603,3048,2212,2613,2632,3153,2812,3196,3307
,3818,16
23,2166,2192,2628,2286,2693,2717,3167,2372,2811,
2861,3262,2968,3354,3399,3925,2439,2921,3016,340
1,3096,3
488,3609,4011,3207,3620,3710,4116,3766,4217,4344
,4830,968,1385,1476,1953,1560,2005,2077,2536,161
2,2099,2
171,2616,2233,2643,2671,3164,1705,2193,2283,2673
,2371,2800,2831,3252,2431,2908,2962,3382,3049,34
48,3549,
3936,1793,2305,2403,2837,2516,2939,2931,3453,255
3,3028,3064,3510,3173,3613,3639,4121,2642,3097,3
199,363
2,3253,3737,3772,4236,3320,3808,3887,4356,4035,4
485,4607,5057,1868,2454,2523,3030,2602,3085,3181
,3621,27
95,3206,3288,3755,3292,3784,3859,4325,2815,3290,
3319,3829,3481,3886,4000,4460,3590,4032,4089,450
4,4193,4
650,4720,5114,2909,3499,3526,3939,3646,4057,4104
,4585,3711,4177,4239,4698,4345,4772,4867,5301,38
97,4251,
4369,4783,4496,4908,4947,5443,4587,5013,5079,549
5,5195,5618,5743,6146,1041,1508,1596,2102,1703,2
189,227
9,2727,1724,2292,2379,2809,2445,2872,3007,3559,1
838,2409,2527,2927,2585,3083,3051,3592,2620,3117
,3192,37
03,3276,3747,3794,4300,2031,2564,2621,3075,2794,
3166,3220,3764,2808,3279,3305,3795,3370,3862,390
1,4415,2
816,3348,3414,3899,3588,3991,4081,4507,3634,4153
,4192,4661,4250,4721,4813,5257,2068,2777,2797,32
54,2821,
3291,3381,3878,2920,3482,3523,3967,3614,4064,416

6,4615,3198,3561,3654,4083,3719,4214,4261,4707,3
871,428
4,4378,4797,4498,4904,4935,5437,3304,3736,3828,4
216,3898,4352,4428,4827,4006,4477,4518,4932,4611
,5015,51
12,5553,4098,4594,4678,5078,4759,5178,5256,5630,
4834,5287,5337,5726,5402,5855,5880,6419,2087,282
5,2871,3
539,3165,3601,3638,4151,3229,3691,3751,4223,3856
,4311,4413,4815,3311,3792,3893,4337,3951,4431,45
21,4917,
4066,4608,4509,4989,4716,5091,5194,5581,3591,390
3,3990,4487,4119,4564,4663,5070,4205,4679,4758,5
179,480
7,5201,5305,5717,4348,4775,4864,5277,4957,5350,5
411,5835,5042,5486,5542,5942,5619,6016,6032,6286
,3726,40
01,4198,4696,4303,4744,4780,5226,4391,4879,4910,
5326,4991,5351,5511,5874,4421,4979,5076,5484,519
2,5554,5
567,6018,5297,5648,5709,6067,5824,6166,6219,6545
,4622,5170,5188,5610,5314,5650,5740,6085,5400,58
34,5844,
6198,5947,6224,6429,6646,5461,5939,5981,6336,607
8,6345,6496,6747,6111,6512,6538,6838,6624,6918,6
939,717
0,1082,969,727,1609,928,1535,1266,2238,1017,1271,
1331,2074,1400,1820,1721,2418,1165,1384,1457,176
4,1536,
1978,1884,2629,1670,1920,2016,2355,2120,2801,251
8,3159,1211,1497,1555,1941,1683,1985,2145,2459,1
725,219
5,2059,3004,2301,2565,2658,3785,1809,2161,2381,2
591,2276,2716,2917,3463,2446,2870,2796,3224,3047
,3560,32
93,4238,1309,1624,1696,2085,1794,2184,2327,2672,
1899,2495,2199,2745,2410,2817,2952,3318,1983,229
7,2587,2
911,2519,3152,2860,3391,2394,2963,3194,3498,3082
,3876,3630,4704,2065,2584,2447,3057,2761,3006,32
40,3525,
2656,3349,3126,3744,3221,3645,4152,3980,2826,327
0,3375,3915,3462,3756,3817,4326,3527,4033,3885,4
595,411
7,4956,4461,5424,1442,1743,1869,2282,1956,2377,2
494,2923,2055,2684,2425,2974,2567,3054,3172,3666
,2140,25
17,2771,3073,2633,3306,3129,3635,2820,3228,3415,
3767,3355,3850,4003,4376,2224,2726,2593,3188,295
4,3277,3
449,3805,2916,3573,3310,4176,3511,3910,3937,4510
,3062,3412,3702,4002,3615,4063,4228,5022,3797,42
86,4136,
4575,4412,4723,4812,5528,2370,2810,3017,3383,288
0,3480,3641,4023,3105,3748,3522,4351,3819,4088,4
219,466
0,3197,3608,3851,4160,3966,4262,4506,4747,3709,4
451,4310,4916,4592,4848,5088,5686,3289,3896,4009
,4469,37
54,4357,4535,5169,4099,4646,4733,4934,4400,5285,
5049,6308,4196,4699,4796,5227,4851,5101,5200,585
3,4606,5
334,5403,5609,5476,6087,5742,6851,1599,1921,2008
,2497,2150,2692,2576,3158,2188,2612,2940,3238,27
76,3344,
3438,3884,2326,2830,2719,3380,2949,3633,3296,396
4,3084,3483,3664,4056,3538,4324,4215,5005,2438,2
975,287
3,3786,3218,3452,3558,4065,3055,3612,3727,4492,3
825,4139,4263,4763,3255,3879,3757,4350,4010,4231
,4497,48
33,3933,4450,4572,4907,4659,5054,5259,5592,2525,
3372,3031,3647,3146,3900,3746,4368,3297,3804,398
3,4301,4
062,4468,4586,4958,3496,4161,3938,4725,3863,4494
,4565,5203,4285,4639,4773,5058,4835,5159,5339,59
37,3600,
4206,4060,4605,4339,4706,4909,5313,4484,4988,473
5,5214,4806,5493,5406,5843,4106,4878,5100,5455,5
014,538
4,5676,5832,5189,5616,5529,6054,5777,5973,6167,6
930,2700,3180,3400,3877,3524,3950,4222,4614,3644
,4388,40
07,4697,4137,4520,4850,5307,3334,4082,4199,4804,
4354,5055,4732,5279,4519,4925,5004,5478,4638,563
1,5404,6
428,3793,4237,4462,5150,4621,4946,4905,5584,4338
,5040,5233,5442,5177,5512,5725,5983,4781,5205,50
90,5543,
5312,5861,5661,6077,5407,5748,5940,6197,5845,614
4,6497,6645,3892,4495,4677,5023,4389,5327,5113,5
608,483
1,5158,5463,5710,5232,5776,5944,6276,4584,5385,5
299,5807,5485,5980,5847,6252,5628,5920,6102,6193
,6053,65
37,6434,6774,4927,5555,5426,5971,5719,6324,5922,
6375,5335,6108,6033,6454,6066,6517,6607,7325,553
1,6279,6
199,6670,6165,6588,6724,6996,6365,6699,6635,7089
,6803,7469,7020,7637,1863,2075,2266,2741,2402,28
13,2941,
3442,2490,3155,2899,3676,3050,3508,3780,4218,258
6,2969,3241,3572,3109,3947,3660,4319,3345,3858,4
061,472
2,3809,4377,4486,5068,2670,3230,3161,3750,3374,3
849,4022,4508,3589,4165,3911,4420,4120,4593,4825
,5213,34
89,4080,3989,4574,4230,4768,4662,5171,4353,4805,
4924,5741,4976,5436,5338,5970,2834,3278,3548,394
6,3749,4
034,4458,4637,3413,4090,4260,4724,4138,4891,4745
,5300,3718,4336,4379,5053,4204,4824,4990,5462,46
09,5077,
4877,5387,5202,5530,5651,6131,3932,4430,4676,493
3,4534,5151,5059,5583,4774,5324,5215,5513,5052,5
677,575

1,6100,4505,5349,5296,5711,5479,5921,5840,6253,5191,5825,5960,6529,6052,6433,6344,6871,3065,3781,3506,4229,3640,4658,4167,4977,3982,4318,4511,4943,4476,4866,5122,5593,3924,4782,4573,5258,4429,5071,5043,5685,4734,5193,5401,5541,5315,5778,5854,6217,4118,4623,4832,5168,4911,5454,5304,5938,4647,5278,5566,5842,5386,5749,6019,6325,4978,5514,5453,5863,5687,6110,5962,6417,5649,6038,6226,6452,6164,6544,6604,7107,4349,5012,4746,5425,4865,5336,5552,5974,5069,5770,5494,5943,5611,6065,6103,6498,5190,5716,5585,6145,5862,6084,6277,6772,5826,6347,6176,6536,6326,6634,6721,6946,5298,5595,5923,6216,5750,6254,6374,6625,6035,6516,6310,6698,6453,6727,6837,7063,5972,6418,6518,6931,6606,6792,6850,7217,6338,6917,6998,7166,7021,7259,7384,7690,3350,3857,3745,4541,4046,4651,4493,5115,4150,4414,4876,5460,4769,5204,5347,5827,4233,4814,4717,5276,5041,5660,5325,5881,4959,5405,5515,6064,5594,5961,6177,6528,4459,5056,4926,5427,5176,5492,5540,5975,4826,5582,5724,6192,5846,6129,6086,6547,5286,5727,5936,6079,5833,6227,6327,6668,5684,6366,6218,6627,6444,6745,6802,7145,4620,4906,5306,5718,5123,5629,5875,6195,5452,6017,5779,6130,5410,6278,6339,6697,5510,5852,5941,6531,6034,6311,6430,6938,6109,6514,6367,6726,6591,6793,6928,7169,5617,5946,6196,6431,6055,6632,6515,6839,6287,6455,6669,6869,6539,7061,6944,7256,6147,6626,6725,6947,6794,7104,7022,7333,6720,7009,7167,7401,7144,7279,7457,7737,4942,5212,5348,5860,5580,6101,5841,6364,5487,5963,5945,6499,6076,6546,6445,6919,5708,6225,6039,6432,6309,6519,6671,6868,6194,6633,6723,6945,6605,7010,7091,7332,5806,6128,6416,6589,6255,6744,6644,6999,6337,6696,6775,7171,6916,7023,7062,7400,6513,6849,6937,7090,6836,7257,7146,7386,6746,7165,7278,7513,7219,7456,7471,7775,5982,6346,6435,6848,6590,6722,6936,7105,6530,6773,6870,7147,6997,7276,7216,7459,6647,6929,7008,7258,7060,7168,7327,7553,7088,7335,7324,7470,7387,7515,7555,7930,6795,7011,7106,7326,7164,7334,7403,7514,7218,7402,7385,7638,7468,7639,7554,7774,7277,7458,7512,7688,7552,7689,7691,7739,7636,7736,7738,7773,7772,7931,7928,7929,260,261,262,419,263,452,455,676,416,454,501,720,552,733,735,1085,417,500,502,732,555,790,859,1101,638,858,806,1168,933,1192,1246,1564,418,553,637,804,639,857,867,1170,721,915,935,1193,1044,1262,1320,1654,734,973,1047,1274,1100,1343,1399,1677,1131,1417,1468,1817,1493,1854,1964,2349,453,554,678,914,722,934,1027,1253,788,1084,974,1321,1128,1355,1446,1738,856,1046,1130,1416,1180,1465,1492,1845,1244,1495,1566,1912,1652,1992,2047,2504,913,1169,1194,1471,1263,1546,1602,1973,1341,1603,1676,2015,1746,2105,2153,2609,1419,1736,1826,2115,1852,2156,2245,2706,1937,2253,2339,2767,2412,2852,2959,3515,503,677,723,1045,791,1087,1102,1445,864,1129,1181,1470,1245,1544,1557,1966,932,1182,1247,1547,1275,1601,1673,2026,1354,1674,1737,2088,1844,2138,2228,2677,1020,1260,1342,1647,1388,1675,1757,2125,1469,1824,1853,2158,1936,2251,2329,2766,1556,1882,1974,2269,2024,2365,2414,2843,2107,2464,2574,2906,2639,3000,3186,3529,1025,1352,1464,1760,1523,1847,1915,2255,1565,1938,1995,2348,2060,2413,2483,2887,1663,2027,2089,2449,2157,2542,2625,3022,2218,2650,2715,3122,2787,3232,3282,3791,1756,2126,2208,2582,2270,2676,2731,3151,2385,2755,2844,3264,2912,3286,3446,3960,2481,2866,2964,3377,2991,3485,3553,4073,3177,3585,3671,4052,3723,4181,4315,4846,636,789,805,1171,865,1183,1254,1600,866,1255,1322,1655,1396,1739,1761,2220,975,1323,1397,1774,1466,1827,1880,2221,1494,1867,1965,2338,2044,2384,2440,2842,1023,1447,1520,1816,1585,1883,1975,2366,1645,1999,2061,2442,2104,2531,2598,2988,1644,2090,2136,2530,2217,2636,2679,3123,2310,2737,2788,3215,2864,3280,3386,3905,1086,1559,1586,1997,1662,2082,2127,2505,1678,2152,2174,2611,2246,2704,2749,3213,1939,2229,2271,2713,2350,2785,2857,3266,2467,2878,2978,3366,3033,3474,3568,4030,2081,2345,2443,2807,2515,2905,2986,3456,2607,3014,3078,3514,3187,3616,3686,4131,2728,3179,3233,3672,3267,3729,3626,4209,3417,3873,3961,4342,3973,4531,4619,4953,1103,1660,1672,2216,1904,2250,2328,2736,1998,2337,2351,2804,2466,2884,2977,3458,2062,2450,2514,2885,2580,2987,3041,3532,2651,3091,3150,3598,3265,3683,3779,4241,2219,2540,2597,304

0,2678,3
137,3245,3650,2790,3248,3284,3771,3418,3715,3931
,4372,2895,3358,3468,3881,3533,3972,4039,4446,36
17,4055,
4054,4583,4211,4667,4739,5160,2344,2648,2738,324
9,2879,3285,3385,3823,2979,3457,3487,3962,3582,3
985,405
3,4525,3068,3545,3656,4031,3694,4071,4225,4669,3
815,4254,4307,4753,4410,4881,4950,5381,3214,3680
,3761,42
27,3929,4244,4394,4800,3958,4382,4464,4913,4558,
4997,5126,5562,3987,4544,4653,5033,4702,5136,508
2,5607,4
841,5237,5280,5766,5420,5836,5967,6235,679,807,9
12,1195,972,1340,1398,1758,1022,1418,1467,1773,1
522,1865 ,1881,2358,1024,1521,1558,1864,1587,208
3,2112,2480,1692,2114,2211,2608,2248,2681,2739,3
258,1026,1584,166
1,2091,1694,2209,2230,2662,1759,2254,2330,2764,2
364,2853,2892,3300,1825,2346,2421,2876,2506,2976
,3001,34
28,2560,2989,3101,3544,3120,3596,3681,4333,1261,
1693,1747,2247,1775,2331,2359,2806,1913,2441,247
2,2932,2
563,3020,3090,3466,1996,2475,2596,2998,2661,3114
,3133,3570,2712,3135,3148,3685,3356,3730,3855,43
74,2063,
2660,2698,3142,2784,3235,3257,3699,2856,3343,339
5,3814,3494,3906,3963,4473,2915,3445,3540,3969,3
618,402
6,4145,4561,3741,4168,4258,4680,4312,4779,4894,5
374,1272,1763,1866,2415,1994,2473,2575,3032,2046
,2599,26
63,3136,2729,3169,3201,3696,2139,2699,2781,3203,
2855,3326,3379,3802,2913,3422,3492,3954,3571,399
2,4103,4
482,2231,2805,2891,3387,3002,3469,3467,3995,3069
,3552,3586,4074,3705,4157,4189,4685,3168,3619,37
33,4182,
3803,4281,4314,4808,3872,4366,4435,4914,4579,501
1,5129,5579,2316,2958,3015,3554,3132,3607,3707,4
169,331
5,3740,3838,4299,3842,4328,4405,4873,3359,3840,3
867,4387,4015,4434,4550,4994,4128,4576,4643,5036
,4729,51
74,5250,5626,3423,4041,4092,4489,4202,4591,4666,
5107,4259,4711,4811,5228,4895,5292,5395,5789,444
1,4817,4
921,5321,5030,5446,5491,5925,5109,5533,5605,6003
,5697,6116,6213,6582,1389,1914,2014,2606,2137,26
97,2765,
3275,2172,2786,2867,3341,2933,3410,3531,4109,226
8,2893,3023,3459,3103,3605,3577,4130,3138,3657,3
722,425
3,3834,4291,4340,4842,2507,3076,3139,3599,3314,3
698,3762,4306,3340,3837,3853,4341,3928,4406,4445
,4963,33
60,3890,3976,4443,4126,4547,4631,5039,4184,4695,
4728,5185,4816,5251,5361,5745,2562,3313,3325,381
2,3365,3
841,3953,4424,3444,4024,4085,4527,4158,4602,4708
,5141,3732,4111,4208,4633,4267,4776,4819,5239,44
11,4836,
4936,5331,5032,5430,5475,5915,3852,4280,4386,477
8,4442,4902,4970,5371,4556,5003,5062,5472,5137,5
535,562
4,6041,4664,5118,5216,5604,5275,5672,5744,6126,5
378,5773,5821,6206,5894,6307,6328,6791,2583,3367
,3409,41
01,3697,4135,4188,4693,3777,4245,4295,4791,4398,
4857,4961,5365,3865,4334,4437,4885,4515,4973,506
5,5465,4
618,5134,5045,5519,5242,5615,5696,6071,4129,4447
,4546,5019,4683,5086,5187,5598,4749,5217,5274,56
73,5357,
5701,5797,6183,4898,5311,5390,5753,5499,5864,590
9,6271,5558,5996,6030,6382,6117,6448,6470,6694,4
276,455
1,4742,5222,4847,5268,5318,5732,4951,5415,5450,5
814,5521,5865,6007,6322,4967,5507,5600,5992,5694
,6046,60
51,6466,5781,6132,6175,6495,6250,6592,6655,6925,
5144,5666,5674,6106,5810,6136,6208,6521,5890,627
0,6292,6
636,6397,6656,6807,7026,5953,6371,6427,6734,6508
,6749,6860,7109,6567,6882,6920,7174,6980,7222,72
63,7464,
1444,1273,1021,2045,1252,1967,1646,2730,1353,165
3,1695,2572,1772,2252,2159,2904,1545,1762,1855,2
210,197
2,2448,2336,3143,2106,2356,2482,2845,2610,3327,3
012,3693,1567,1905,1993,2367,2113,2465,2637,2965
,2173,27
05,2543,3528,2791,3077,3178,4329,2249,2649,2877,
3115,2754,3256,3433,3999,2934,3408,3324,3770,356
9,4110,3
843,4810,1679,2080,2124,2581,2244,2680,2841,3202
,2347,2997,2707,3283,2894,3361,3484,3866,2451,27
89,3113,
3429,3013,3684,3394,3959,2886,3493,3728,4040,360
4,4418,4180,5236,2561,3102,2935,3583,3287,3530,3
800,408
7,3176,3891,3670,4288,3763,4201,4694,4530,3376,3
822,3941,4465,3998,4304,4373,4880,4093,4577,4427
,5119,46
81,5498,4995,5910,1846,2175,2317,2780,2420,2865,
2996,3447,2541,3212,2907,3512,3079,3580,3704,422
6,2624,3
003,3301,3597,3149,3854,3673,4185,3364,3776,3977
,4313,3907,4396,4553,4928,2714,3274,3121,3714,34
86,3835,
3993,4363,3432,4125,3864,4710,4075,4454,4483,504
6,3584,3974,4252,4552,4159,4601,4792,5548,4343,4
840,468
8,5105,4960,5253,5360,6020,2854,3342,3541,3955,3
416,4014,4191,4571,3627,4292,4084,4901,4375,4642,4787,51
84,3731,4144,4397,4700,4526,4820,5038,5271,4255,4985,4856,5464,5116,5380,5606,6168,3839,4440,4559,4999,4
298,4915,5075,5665,4665,5166,5265,5474,4952,5767,5563,6700,4738,5229,5330,5733,5383,5621,5700,6303,5128,
5818,5895,6105,5966,6541,6212,7195,2025,2357,2474,2999,2638,3234,3100,3692,2696,3134,3470,3790,3312,388
8,3984,4426,2840,3378,3259,3952,3475,4183,3846,4524,3606,4025,4224,4590,4100,4872,4777,5525,2914,3513,34
11,4332,3760,3994,4108,4603,3581,4156,4277,5024,4383,4691,4821,5281,3813,4425,4305,4900,4560,4795,5031,5
377,4481,4984,5094,5435,5183,5574,5747,6092,3021,3930,3555,4203,3682,4444,4290,4920,3847,4362,4537,4843,
4600,4998,5108,5500,4038,4701,4488,5261,4407,5026,5087,5703,4837,5163,5293,5588,5379,5655,5823,6359,413
4,4752,4598,5127,4887,5238,5447,5803,5010,5518,5267,5728,5356,5999,5904,6283,4668,5414,5620,5935,5534,58
70,6150,6264,5675,6114,6021,6488,6239,6411,6593,7250,3244,3706,3968,4419,4086,4514,4790,5140,4200,4938,4
557,5223,4689,5064,5382,5799,3880,4632,4743,5354,4912,5575,5264,5761,5063,5469,5524,5978,5162,6127,5898,
6806,4335,4809,4996,5646,5143,5490,5431,6088,4886,5556,5737,5924,5669,6010,6201,6441,5319,5705,5614,603
1,5802,6315,6139,6503,5905,6214,6378,6631,6293,6578,6861,7025,4436,5027,5199,5549,4939,5815,5625,6104,53
75,5654,5959,6180,5736,6238,6392,6682,5106,5871,5783,6249,5993,6426,6301,6666,6122,6334,6558,6617,6487,6
911,6826,7118,5471,6047,5912,6407,6187,6714,6352,6771,5819,6564,6471,6846,6494,6897,6977,7545,6025,6687,
6637,7040,6585,6964,7076,7300,6761,7051,7013,7369,7151,7693,7316,7793,2311,2573,2748,3281,2890,3357,347
1,3986,2990,3687,3419,4240,3576,4072,4320,4786,3112,3495,3801,4124,3651,4501,4210,4871,3889,4404,4599,52
52,4367,4929,5018,5590,3200,3778,3695,4294,3940,4395,4570,5044,4127,4703,4455,4966,4684,5117,5367,5721,4
027,4630,4545,5104,4794,5282,5186,5667,4903,5355,5468,6209,5504,5914,5822,6406,3384,3836,4102,4500,4293,
4578,4992,5161,3975,4652,4818,5260,4690,5421,5269,5788,4266,4884,4937,5571,4748,5366,5520,5958,5135,560
1,5397,5887,5702,6024,6137,6573,4480,4972,5198,5473,5074,5647,5589,6075,5310,5812,5729,6011,5570,6151,62
23,6554,5037,5851,5780,6181,5979,6335,6272,6667,5689,6251,6398,6903,6486,6823,6748,7205,3587,4321,4070,4
793,4190,5182,4709,5505,4536,4870,5047,5483,5002,5394,5638,6093,4472,5320,5095,5746,4971,5599,5559,6161,
5266,5695,5891,6027,5811,6242,6306,6649,4682,5145,5376,5664,5451,5934,5796,6370,5167,5760,6050,6282,588
6,6215,6467,6715,5506,6014,5929,6319,6169,6566,6400,6785,6133,6480,6662,6842,6584,6924,6968,7409,4899,55
32,5270,5911,5391,5820,6040,6420,5591,6234,6002,6383,6107,6493,6559,6864,5688,6182,6089,6579,6318,6520,6
683,7116,6256,6753,6594,6910,6728,7012,7059,7292,5782,6099,6353,6648,6222,6678,6770,6981,6477,6896,6708,
7050,6843,7085,7163,7365,6410,6790,6900,7251,6976,7128,7194,7487,6742,7215,7302,7446,7317,7531,7606,784
8,3904,4399,4289,5083,4582,5175,5025,5627,4692,4962,5396,5952,5283,5704,5837,6257,4801,5364,5243,5752,55
57,6138,5813,6329,5501,5899,6015,6492,6098,6399,6595,6902,4993,5578,5470,5913,5668,5998,6026,6421,5370,6
074,6200,6616,6300,6569,6540,6957,5772,6207,6358,6509,6265,6663,6729,7034,6160,6764,6654,6983,6830,7099,
7150,7421,5142,5434,5798,6186,5639,6123,6323,6629,5928,6449,6243,6572,5908,6686,6743,7047,6006,6302,637
9,6907,6476,6709,6810,7262,6565,6892,6765,7084,6967,7129,7244,7461,6115,6396,6630,6811,6489,6986,6893,71
75,6695,6847,7035,7201,6921,7355,7266,7502,6583,6982,7077,7293,7132,7390,7346,7581,7058,7309,7447,7629,7
420,7541,7663,7869,5482,5720,5850,6314,6070,6555,6273,6760,5997,6401,6393,6865,6502,6956,6831,7223,6174,
6657,6481,6822,6701,6901,7041,7200,6628,6987,7067,7267,6969,7312,7375,7580,6248,6568,6784,6965,6679,709
8,7024,7303,6735,7046,7119,7465,7214,7347,7364,7628,6883,7187,7253,7374,7162,7503,7422,7620,7108,7433,75
40,7723,7493,7662,7713,7965,6440,6752,6827,7186,6966,7066,7252,7391,6906,7117,7204,7423,7301,7536,7486,7
665,7027,7245,7308,7530,7354,7460,7575,7755,7368,7587,7544,7712,7621,7751,7785,8060,7133,7313,7408,7574,
7432,7586,7653,7750,7492,7652,7607,7820,7692,782

1,7784,7964,7537,7664,7722,7826,7754,7827,7849,7911,779
2,7868,7910,7941,7940,8061,7982,7983,1390,1391,1744,1907,1745,2012,2155,2528,1818,2154,2223,2626,2318,27
51,2753,3363,1819,2222,2308,2750,2387,2846,2967,3421,2512,2966,2888,3472,3089,3564,3624,4140,1906,2319,2
423,2858,2513,2957,3035,3534,2627,3071,3141,3565,3328,3674,3734,4256,2752,3171,3331,3720,3420,3789,3883,
4283,3465,3917,3996,4453,4029,4528,4628,5125,2013,2386,2604,3070,2682,3140,3303,3649,2782,3362,3184,373
5,3434,3833,3956,4364,2956,3330,3464,3916,3542,3971,4028,4491,3578,4037,4142,4580,4246,4670,4741,5254,30
43,3473,3566,4013,3675,4078,4174,4641,3769,4175,4282,4713,4380,4803,4875,5369,3919,4360,4474,4845,4512,4
882,4983,5466,4597,5017,5097,5545,5164,5632,5723,6221,2309,2529,2683,3329,2847,3393,3430,3943,2984,3435,
3543,4012,3579,4076,4095,4634,3088,3546,3625,4079,3721,4173,4271,4730,3832,4278,4361,4784,4490,4868,497
4,5429,3246,3668,3788,4243,3844,4279,4385,4853,3997,4466,4513,4892,4596,5009,5081,5544,4094,4562,4654,50
35,4714,5147,5172,5613,4823,5220,5328,5692,5399,5774,5926,6229,3273,3820,3970,4408,4069,4503,4589,5029,4
141,4616,4673,5124,4750,5165,5249,5659,4269,4731,4785,5211,4883,5294,5389,5794,4964,5416,5489,5876,5561,
5954,6004,6423,4384,4854,4930,5342,5060,5428,5503,5903,5155,5537,5622,5988,5698,6012,6154,6548,5247,564
2,5730,6083,5759,6189,6245,6621,5917,6275,6331,6612,6385,6703,6805,7126,2422,2783,2859,3535,2985,3547,36
58,4172,3034,3659,3742,4257,3874,4365,4409,4968,3185,3743,3875,4438,3978,4475,4554,4969,4036,4549,4629,5
096,4736,5154,5196,5612,3251,3957,4042,4452,4147,4563,4655,5152,4187,4687,4751,5208,4802,5289,5358,5756,
4186,4788,4858,5288,4955,5392,5433,5877,5066,5517,5568,5951,5640,6000,6096,6507,3392,4133,4170,4675,426
8,4766,4855,5255,4296,4874,4922,5373,4986,5458,5527,5949,4617,4975,5061,5481,5130,5551,5637,5990,5231,56
52,5738,6080,5801,6184,6258,6602,4765,5099,5209,5597,5273,5691,5754,6156,5363,5790,5830,6220,5927,6298,6
350,6677,5496,5919,5955,6332,5991,6387,6312,6731,6125,6485,6549,6820,6557,6941,6995,7185,3431,42
64,4270,
4954,4568,5008,5080,5516,4686,5093,5131,5576,5230,5656,5735,6158,4754,5218,5272,5657,5340,5755,5809,623
2,5417,5839,5902,6290,5989,6343,6415,6741,4965,5290,5353,5808,5432,5889,5965,6316,5572,5976,6008,6409,61
34,6381,6525,6832,5683,6062,6170,6491,6233,6556,6609,6890,6299,6615,6614,6979,6733,7017,7069,7304,5098,5
412,5522,5977,5653,6009,6095,6451,5739,6157,6191,6550,6268,6571,6613,6933,5816,6241,6320,6603,6356,6619,
6737,7019,6443,6756,6797,7075,6866,7139,7182,7417,5950,6340,6403,6739,6523,6750,6852,7096,6542,6840,689
8,7159,6960,7211,7284,7500,6575,6948,7007,7235,7052,7290,7260,7525,7123,7341,7370,7596,7434,7630,7677,77
87,2605,2889,3042,3567,3170,3768,3882,4392,3250,3918,3979,4433,4068,4539,4555,5138,3272,4043,4132,4538,4
171,4767,4838,5246,4322,4844,4949,5368,5000,5445,5523,5986,3302,4146,4265,4789,4330,4931,4980,5422,4393,
5028,5084,5538,5146,5633,5680,6022,4467,5110,5181,5644,5262,5734,5775,6142,5308,5757,5849,6240,5868,628
8,6341,6815,3669,4323,4381,4987,4439,5085,5139,5596,4581,5197,5240,5712,5317,5792,5838,6162,4674,5245,53
52,5764,5419,5866,5879,6260,5480,5885,5900,6349,6060,6388,6475,6834,4755,5418,5456,5896,5550,5957,5985,6
363,5636,6059,6113,6442,6204,6510,6551,6905,5707,6153,6236,6553,6304,6600,6685,6963,6395,6692,6758,7028,
6798,7081,7148,7410,3712,4417,4548,5173,4672,5241,5329,5800,4740,5359,5423,5888,5497,5907,5931,6360,486
9,5457,5547,5933,5635,6048,6091,6436,5699,6140,6202,6534,6261,6576,6653,6912,4981,5577,5671,6097,5784,61
71,6163,6581,5817,6244,6280,6622,6369,6689,6711,7033,5906,6305,6391,6704,6437,6769,6804,7100,6484,6828,6
879,7160,6975,7225,7287,7509,5072,5722,5791,6246,5878,6297,6377,6693,6043,6394,6460,6787,6464,6812,6859,
7137,6063,6462,6483,6845,6597,6878,6952,7208,6674,6972,7005,7236,7065,7314,7348,7534,6141,6611,6642,691
5,6718,6985,7016,7273,6759,7057,7103,7338,7149,7376,7427,7605,6885,7111,7173,7383,7232,7440,7467,7667,72
75,7489,7523,7687,7567,7734,7779,7902,3845,4588,4712,5362,4859,5449,5539,5995,4896,5560,5643,6057,5713,6 120,6231,6659,5034,5681,5795,6159,5857,6295,6263,6676,5892,6321,6384,6755,6456,6779,6818,7124,5263,5828,
5893,6291,6042,6362,6404,6796,6056,6459,6473,6819,6522,6862,6889,7191,6068,6504,6562,6887,6672,6951,700
1,7239,6706,7045,7064,7321,7110,7349,7397,7589,5316,6029,6045,6438,6073,6463,6533,6874,6152,6598,6639,69
35,6690,6992,7054,7295,6390,6661,6730,7003,6763,7078,7113,7343,6867,7120,7178,7389,7234,7436,7455,7661,6
472,6768,6844,7080,6886,7156,7196,7407,6958,7221,7246,7452,7291,7491,7532,7709,7014,7282,7330,7522,7367,
7558,7588,7742,7414,7599,7625,7770,7646,7815,7824,7971,5343,6081,6119,6651,6361,6681,6710,7043,6413,675
1,6783,7087,6856,7131,7189,7399,6479,6816,6881,7141,6927,7199,7249,7445,6994,7288,7241,7481,7344,7527,75
66,7717,6675,6891,6950,7227,7031,7264,7323,7518,7073,7331,7366,7559,7395,7569,7609,7765,7152,7379,7424,7
593,7473,7634,7655,7803,7498,7682,7706,7838,7735,7860,7864,7942,6766,6953,7070,7336,7127,7360,7380,7582,
7183,7431,7442,7618,7483,7635,7695,7822,7193,7479,7520,7680,7564,7710,7715,7862,7601,7744,7761,7879,779
6,7906,7923,8009,7298,7550,7560,7730,7614,7746,7776,7885,7644,7802,7808,7918,7843,7924,7973,8030,7673,78
35,7857,7952,7882,7957,7988,8051,7895,7992,8006,8066,8020,8078,8087,8126,3942,3713,3247,4737,3648,4635,4
242,5502,3821,4247,4331,5322,4432,5016,4893,5690,4077,4416,4529,4948,4640,5210,5092,5897,4822,5132,5248,
5623,5372,6049,5786,6355,4143,4569,4671,5153,4839,5221,5393,5731,4897,5459,5295,6228,5573,5829,5918,681
3,5001,5413,5645,5867,5536,5984,6149,6587,5714,6118,6044,6408,6259,6660,6465,7102,4297,4764,4852,5341,49
82,5444,5603,5932,5111,5763,5467,6005,5682,6069,6188,6482,5219,5569,5859,6143,5787,6348,6112,6543,5658,6
203,6386,6610,6294,6872,6702,7340,5309,5856,5715,6269,6013,6230,6424,6641,5916,6505,6330,6776,6405,6717,
7044,6940,6082,6450,6527,6899,6586,6788,6833,7138,6643,6973,6877,7283,7029,7472,7209,7656,4502,4923,507
3,5546,5180,5641,5762,6155,5291,5948,5693,6210,5831,6266,6368,6738,5388,5785,6023,6289,5901,6474,6333,67
07,6072,6412,6563,6799,6511,6854,6955,7176,5488,
5994,5869,6380,6190,6457,6577,6825,6148,6665,6478,7056,6
623,6894,6913,7242,6274,6560,6754,6954,6691,6991,7092,7494,6821,7122,7036,7271,7188,7351,7396,7700,5634,
6058,6237,6535,6124,6596,6713,6971,6313,6780,6638,7155,6835,7004,7083,7320,6389,6684,6855,7048,6934,711
4,7238,7363,6757,7203,7130,7444,7280,7416,7524,7758,6461,6884,6961,7213,6786,7161,7255,7549,7015,7310,73
57,7454,7184,7597,7501,7944,7068,7339,7388,7583,7419,7529,7568,7813,7286,7622,7647,7729,7676,7887,7778,8
071,4715,5133,5244,5765,5398,5956,5848,6354,5448,5884,6172,6422,6028,6500,6570,6876,5602,6090,5987,6532,
6185,6705,6468,6932,6296,6599,6736,6984,6650,7136,7079,7485,5706,6211,6121,6814,6402,6580,6658,6993,626
7,6688,6767,7228,6841,7039,7115,7371,6439,6875,6789,7154,6962,7095,7233,7413,6909,7202,7268,7439,7319,75
06,7591,7724,5793,6524,6247,6719,6342,6888,6778,7172,6469,6824,6943,7125,6990,7212,7274,7474,6608,7049,6
914,7353,6863,7230,7265,7571,7121,7307,7377,7510,7415,7547,7627,7833,6680,7074,6988,7285,7143,7342,7441,
7613,7224,7480,7359,7578,7394,7685,7650,7807,7018,7430,7528,7671,7490,7640,7752,7800,7561,7732,7701,787
4,7789,7853,7907,8082,5964,6376,6552,6873,6640,6926,7086,7294,6716,7180,6959,7337,7037,7248,7418,7611,64
90,7002,7071,7392,7158,7507,7356,7595,7247,7449,7484,7678,7306,7743,7648,7972,6817,7101,7210,7542,7297,7
466,7437,7720,7142,7496,7585,7666,7557,7696,7769,7859,7381,7573,7526,7707,7612,7817,7749,7881,7651,7780,
7836,7917,7809,7900,7989,8029,6880,7231,7329,7495,7181,7619,7533,7728,7411,7546,7675,7762,7584,7788,784
0,7936,7272,7641,7603,7795,7681,7856,7811,7932,7740,7828,7890,7913,7873,8005,7978,8054,7451,7711,7658,78
51,7767,7948,7830,7967,7623,7892,7865,7986,7878,7997,8019,8141,7703,7939,7919,8034,7905,8012,8044,8092,7
961,8039,8027,8109,8063,8161,8100,8173,5067,5323,5526,6001,5670,6061,6173,6574,5758,6351,6135,6740,6262,
6620,6808,7082,5858,6205,6425,6664,6317,6923,6732,7135,6501,6858,6989,7350,6829,7177,7226,7516,5930,641
4,6357,6782,6526,6853,6970,7240,6673,7053,6895,7192,7032,7281,7405,7577,6601,7000,6949,7270,7094,7372,73 22,7551,7157,7393,7448,7777,7476,7660,7626,7850, 6094,6458,6652,6922,6781,6974,7206,7305,6561,700 6,7112,7 352,7038,7435,7361,7604,6762,7140,7179,7505,7072 ,7404,7482,7674,7289,7521,7429,7643,7570,7702,77 47,7899, 6908,7198,7328,7453,7254,7543,7511,7719,7378,761 6,7579,7697,7504,7753,7783,7888,7237,7633,7600,7 763,767 9,7829,7804,7933,7563,7797,7844,8001,7872,7977,7 956,8075,6281,6809,6618,7093,6712,7318,7055,7477 ,6942,71 34,7243,7463,7220,7426,7538,7725,6904,7382,7269, 7590,7197,7519,7499,7757,7358,7565,7645,7705,761 5,7790,7 814,7921,7030,7299,7412,7548,7443,7670,7608,7834 ,7311,7594,7714,7806,7642,7781,7863,7949,7478,76 98,7669, 7819,7759,7894,7846,7969,7745,7870,7926,7984,790 4,8008,8016,8115,7153,7488,7362,7657,7425,7624,7 708,785 4,7517,7786,7686,7839,7731,7877,7891,7990,7562,7 764,7721,7901,7818,7884,7937,8052,7798,7959,7908 ,8004,79 50,8026,8041,8090,7602,7727,7831,7920,7782,7934, 7966,8021,7867,7996,7946,8038,7985,8047,8065,810 7,7852,7 970,7998,8083,8018,8056,8070,8129,7954,8077,8094 ,8122,8101,8135,8148,8178,6506,6857,6777,7261,69 78,7315, 7229,7535,7042,7190,7428,7672,7373,7572,7631,779 9,7097,7398,7345,7592,7497,7748,7617,7825,7475,7 649,769 9,7876,7726,7845,7909,8000,7207,7508,7450,7659,7 556,7684,7704,7855,7406,7718,7768,7912,7810,7897 ,7886,80 11,7598,7771,7832,7883,7801,7927,7951,8032,7756, 7962,7922,8023,7980,8049,8062,8117,7296,7438,761 0,7766,7 539,7741,7823,7915,7668,7861,7791,7898,7654,7938 ,7955,8037,7694,7812,7837,8003,7866,7947,7974,80 86,7893, 7994,7963,8046,8015,8057,8080,8125,7733,7842,791 6,7975,7875,8024,7995,8067,7943,7987,8033,8073,8 007,810 5,8088,8132,7903,8022,8045,8091,8058,8112,8102,8 145,8040,8097,8123,8153,8116,8139,8157,8181,7462 ,7576,76 32,7816,7716,7889,7805,7960,7683,7847,7841,7991, 7880,8010,7981,8079,7760,7925,7871,7976,7945,799 9,8035,8 072,7914,8025,8043,8089,8017,8098,8111,8144,7794 ,7896,7968,8013,7935,8048,8028,8095,7953,8036,80 55,8127, 8076,8103,8106,8152,7993,8069,8085,8110,8064,813 3,8118,8150,8050,8121,8138,8165,8131,8156,8163,8 187,785 8,7958,7979,8068,8014,8042,8084,8113,8002,8053,8 074,8119,8093,8136,8128,8159,8031,8081,8096,8134 ,8104,81 24,8143,8169,8108,8147,8140,8162,8151,8167,8171, 8190,8059,8099,8114,8142,8120,8146,8155,8166,813 0,8154,8 149,8174,8160,8175,8170,8186,8137,8158,8164,8176 ,8168,8177,8179,8183,8172,8180,8182,8185,8184,81 91,8188, 8189]

**Sequence group 8: Q8_16384**

[0,1,2,4,8,16,32,3,5,64,9,6,17,10,18,128,12,3 3,65,20,256,34,24,36,7,129,66,512,11,40,68,130,19,1 3,48,1 4,72,257,21,132,35,258,26,513,80,37,25,22,136,260,2 64,38,514,96,67,41,144,28,69,42,516,49,74,272,160,1 026,520 ,288,528,192,544,70,44,131,81,50,73,15,320, 133,52,23,134,384,76,137,82,56,27,97,39,259,84,138, 145,261,29,43,9 8,515,88,140,30,146,1028,71,262,265,161,576,45,100 ,640,1025,51,148,46,75,266,273,517,104,162,53,193, 1032,15 2,77,164,768,2048,2049,268,274,518,54,83,57,521,11 2,1024,135,78,289,194,85,276,522,58,168,139,99,86, 60,280,8 9,290,529,524,196,141,1040,101,147,176,142,530,32 1,31,200,90,1056,545,292,322,532,263,149,102,105,3 04,296,1 030,163,92,1033,47,267,385,546,324,208,386,150,15 3,165,106,55,328,1088,536,577,548,1034,113,154,79, 269,205 0,2052,108,578,224,166,519,552,195,270,1041,641,1 036,523,275,580,291,59,2056,2064,169,560,114,277, 156,87,1 152,197,116,170,61,1042,531,525,642,281,278,526,1 77,293,388,1057,2080,2051,91,584,769,198,172,120, 201,336, 4096,4097,4098,4100,62,282,143,1029,1044,103,178, 294,93,1058,644,202,592,323,392,297,2053,2112,770 ,107,18 0,1280,151,209,284,1027,648,94,204,298,400,608,10 89,352,325,533,155,210,305,547,300,109,1048,184,5 34,1060, 537,115,1090,167,225,326,306,772,157,656,329,110, 2057,2054,117,212,171,1038,776,1064,330,1153,226, 549,104 3,538,387,308,216,416,271,279,2065,2058,158,337,5 50,672,1092,118,332,579,540,1072,389,173,1037,121 ,553,199 ,784,179,228,338,2066,2176,312,1536,704,1 154,2060,2081,390,174,554,581,1046,393,283,122,44 8,353,561,1096,2 03,63,340,394,1049,1281,527,582,556,181,295,1059, 285,232,2113,2068,124,205,182,643,1156,562,2304,2 082,286, 585,299,354,1045,211,401,1104,4104,4112,4128,409 9,185,1061,396,344,586,645,1282,593,535,240,1050, 206,95,3 27,564,800,2072,2084,402,356,2055,2177,307,301,41
7,1160,213,1066,568,1120,832,588,4101,4160,4105,4
102,103
5,1537,186,646,404,1091,227,896,594,418,302,649,2
114,2560,771,360,539,111,1052,331,1168,214,2059,2
088,309,
1062,1284,188,449,1073,217,408,609,596,551,650,22
9,159,420,310,1093,541,2116,2178,4113,4106,4114,4
224,128
8,773,610,657,333,1065,119,1098,600,339,1184,218,
368,652,1031,230,8192,8193,8194,8196,8200,8208,8
224,8195 ,391,313,450,542,1538,334,2067,2061,2096
,2062,1076,233,555,774,175,123,1155,658,2120,2305
,612,341,777,220,
314,1105,424,1068,395,673,583,355,4108,4129,4161,
4116,1296,1094,287,183,234,1051,2069,2180,125,55
7,1216,6
60,616,342,2083,2306,316,1157,241,778,563,1074,34
5,452,397,403,1112,207,2074,2561,1540,674,558,785
,1100,4
32,1039,357,187,1162,236,664,1312,624,587,780,108
0,1122,2128,2085,705,126,242,1063,2073,2070,565,3
98,346,
456,2184,2308,358,405,303,569,1544,244,1158,1097,
595,1283,189,566,676,1169,1054,1108,361,706,4352,
4130,41
20,4132,589,1344,215,786,647,348,2312,2086,419,40
6,2562,2144,464,680,2115,2089,801,1069,362,1164,2
192,207
6,590,409,1286,570,1121,788,1552,1106,597,1075,57
2,1186,219,311,4103,4225,4162,4608,708,598,1289,6
01,651,
421,792,802,2117,2090,611,1047,602,1172,410,231,6
88,653,2564,2097,1128,248,1070,369,2122,2320,190,
364,156
8,654,1095,659,1161,335,480,315,221,370,1285,613,
4107,4136,4164,4226,1408,422,2208,3074,425,451,2
568,2336 ,4115,4109,4144,4110,1077,614,543,1298,2
35,412,343,372,2576,2240,1185,775,317,1539,222,10
99,426,453,237,1
124,559,1170,2592,2118,1292,833,804,712,1082,834,
661,1053,2092,2179,2129,2098,808,779,1217,617,60
4,1541,4
33,720,816,1101,2121,2063,1176,836,347,897,4168,4
353,4117,4228,1136,243,1297,662,1600,454,318,675,
2368,21
81,1110,618,4131,4354,4122,4609,1081,898,781,131
4,1220,376,428,1546,2100,2071,665,736,567,1107,21
82,2432,
8197,8256,8201,8198,8209,8202,8210,8320,1192,107
8,2124,2185,840,625,238,1159,359,457,399,787,2130
,2104,5
91,678,434,677,1290,1542,2075,2145,349,1300,1102,
245,1188,458,666,1113,620,1553,4176,4133,4121,41
18,1163,
1313,363,127,4232,4356,4360,4134,1067,191,1125,7
82,407,436,2087,2307,626,1218,2132,2186,571,465,2
193,230
9,681,246,707,1346,8204,8225,8257,8212,8448,8226,
8216,8228,2077,2091,2146,2563,350,1084,599,668,1
548,790,
2136,2188,1165,1320,460,1123,1200,249,682,1664,5
73,1171,411,803,4610,4192,4163,4137,1116,789,130
4,709,36
5,440,628,689,2078,2194,374,1224,3076,2119,423,15
56,4240,4124,4165,4138,466,793,2310,2313,2209,26
24,1130,
250,371,1174,2093,2148,481,574,1348,413,1109,603,
366,1545,1287,1055,468,1570,655,900,805,615,1166,
684,140
9,710,2688,3073,1187,429,4612,4145,4170,4368,819
9,8321,8258,8704,8203,8232,8260,8322,2099,2196,7
94,252,1
114,373,605,1232,848,690,2094,2123,713,632,2314,2
321,1316,482,806,1132,2565,2152,1083,427,1177,90
4,1569,4
14,2210,2101,1291,223,1126,1554,663,692,835,1328,
619,472,2241,3080,1137,455,4256,5122,4616,4384,4
624,428
8,4640,4166,2200,2125,796,1189,1601,809,714,1248,
721,837,716,1086,2212,2816,1302,1352,4140,4227,4
177,414
6,864,810,1173,606,1194,912,1103,722,696,377,2316
,2322,1424,435,2566,2102,1293,1560,817,1129,1792,
319,621 ,1180,8211,8205,8240,8206,8264,8449,8213,
8324,2131,2105,2569,2160,812,484,1345,430,1572,1
138,3072,2183,4
169,4111,4416,4229,1299,838,667,1219,2126,2337,4
88,1111,239,378,459,622,4148,4119,4230,4480,1410,
627,224
2,2133,437,380,1201,1608,818,1178,2324,2570,1294,
461,1543,496,669,1190,1317,679,2106,2216,1140,10
79,4172,
4233,4178,4152,2187,2147,1221,724,841,1305,629,1
584,2134,2108,351,467,2328,2137,1360,438,1115,73
7,2338,2
577,251,462,442,441,2572,2244,1666,469,1549,247,6
83,1196,2189,3088,2149,2195,4123,4193,4135,4355,
1226,84
2,1412,1127,738,1144,2224,2190,4180,4234,4241,43
57,1308,899,1602,670,1318,783,1085,849,4125,4139,
4194,46
11,1555,1193,820,1576,728,928,791,367,2578,2369,1
376,901,2079,2248,2138,3104,1233,630,2593,2340,1
321,685,
844,1204,633,711,2370,2580,2311,2197,2150,2153,1
118,253,691,1301,8227,8450,8218,8705,8272,8229,8
217,8214 ,824,1175,2352,2344,902,686,1668,1222,14
16,1133,740,1347,4184,4236,4126,4242,850,375,155
8,444,5124,4167,4
358,4361,1306,470,1167,483,4257,4672,4141,4196,1
547,415,3078,2211,485,905,2140,3081,4736,5121,41
47,4244,
1202,795,473,1240,2095,2315,634,744,2433,2594,16
16,852,2372,2256,2434,2198,960,1322,2201,2213,86
5,693,21

54,2103,1131,1794,1350,797,8328,8452,8456,8230,8
706,8288,8259,8233,1225,1604,1571,906,2376,3136,
1252,715 ,1141,1330,807,474,636,1179,694,254,4142
,4171,4362,4369,1550,1665,2584,2625,717,1071,259
6,3082,1315,575,9
13,1440,798,811,379,1208,4613,4200,4258,4149,216
1,2202,1353,1191,2127,2317,697,1564,4289,5128,42
48,4173,
431,1142,607,1228,2156,2626,489,1324,2272,2214,8
66,723,2567,2600,486,1573,1181,1234,908,1793,156
1,718,81
3,1364,2243,2318,476,856,8336,8220,8261,8234,870
8,8241,8266,8464,3089,2689,1117,1411,4260,4864,6
144,6145 ,839,1329,1295,1146,4364,4370,4614,4150,
8352,9218,8712,8480,8720,8384,8736,8262,3084,257
1,725,698,1472,9
14,2323,2628,1249,752,868,819,1349,814,439,929,41
79,4153,4617,4208,2339,2107,1197,1578,490,1139,2
217,260
8,1680,623,2162,2325,1632,1336,671,1198,1362,739,
2204,2135,1603,1557,3200,2245,5120,4231,4174,438
5,2164,
2218,1413,916,1303,463,1236,843,2109,3090,1135,3
81,1672,1354,2579,2573,4290,4181,4372,4618,4154,
4264,423
5,4195,497,1586,930,821,2690,2329,726,961,1203,11
82,2326,2574,872,1418,492,1250,1332,631,2225,234
1,4182,4
156,4376,4185,2436,3105,1574,1223,729,1145,1605,
700,8236,8323,8273,8242,8265,8207,8512,8325,2139
,2632,17
96,443,2817,2246,1307,741,2220,2168,1378,1562,13
56,1205,845,1319,4386,4625,4620,4292,2249,2384,9
20,382,8
244,8215,8326,8576,8268,8329,8274,8248,2110,2330
,1585,822,1425,851,2191,3077,3092,2151,1229,730,1
609,498 ,2226,2342,4237,5136,4197,4243,880,1256,7
42,445,1392,471,2141,3106,4272,4238,4626,4417,26
92,2250,2640,23
71,4127,4296,4186,5152,635,1148,1696,932,1580,68
7,2440,2345,1210,1420,1612,1325,1800,903,1134,82
5,4641,4
388,4418,4628,1235,1361,500,1577,846,1670,1195,7
45,2818,2155,2228,3328,4359,4245,4198,4201,826,7
32,2199,
2257,2332,3075,1264,446,2696,2142,962,1426,1620,
936,2252,2346,1377,475,2448,2656,8219,8289,8231,
8451,827
6,8330,8337,8453,3137,2400,2373,2581,853,1310,86
7,637,8221,8235,8290,8707,8280,8332,8222,8338,22
03,2258,
1551,1230,2353,2595,1414,907,1206,1667,1588,1333
,4400,4392,5126,4259,487,1808,2348,2157,4188,512
9,4143,4
363,695,1441,1087,746,4481,4642,4420,4304,828,75
3,1610,854,1237,1326,3096,2232,4482,4246,4249,42
61,4202,
4151,4424,5184,857,1368,2582,3108,1209,504,799,1
355,2585,2163,255,964,4632,4673,4644,5130,3138,2
215,2273 ,2374,1242,909,2354,2820,2205,2704,1673,
1559,1309,719,2377,2158,1143,477,2165,2260,1617,
915,1448,1380,92
20,8263,8454,8457,8353,8768,8237,8292,2219,3086,
638,748,2824,3112,944,1728,1331,1227,869,1592,14
28,491,6
99,1253,4209,4250,4175,4365,1351,754,2378,3201,6
146,6148,4204,4674,1183,1565,2274,2597,8832,9217
,8243,83
40,8238,8267,8458,8465,858,1618,1417,1476,4320,4
262,4615,4648,4291,4366,5137,4737,3091,2586,478,
968,1260 ,383,2435,2356,5132,4619,4371,4676,1212,
910,1801,815,2264,2464,1579,976,2319,2327,870,16
84,1633,917,2206,
2385,2598,2720,3140,2166,1337,1241,2380,2627,160
6,1824,727,1150,1442,493,1357,1251,2588,3120,167
6,873,24
37,2221,1384,701,4387,4155,6152,6160,3085,2169,1
566,931,8709,8296,8354,8245,8385,9224,8344,8269,
4265,465
6,4210,4373,1323,1798,1365,1473,2601,2247,756,13
34,860,499,2832,2227,731,1648,1238,823,4252,4183,
5248,42
93,1575,922,1199,1674,4212,4266,4157,5138,2276,2
386,874,1432,1421,918,2360,3584,4627,4621,4738,4
377,2752 ,3202,1636,1254,2438,2222,502,1795,2602,
2629,933,1366,4374,4622,4273,4389,3094,2441,1338
,1682,2331,2170,
2496,2401,1587,1211,1488,743,1358,760,2609,3144,
1244,1581,881,1147,4484,5153,6176,6147,2251,2111
,494,137
9,8356,8960,10240,10241,8460,8466,8710,8246,8275
,8249,8713,8304,9216,8327,8270,8481,4187,4680,48
65,4294,
1272,702,2388,2442,3097,3329,921,1624,501,876,25
75,2630,1415,847,1856,1444,992,1697,2604,2229,42
68,4216,
4297,4432,2343,3107,2333,2280,8386,8277,8468,871
4,8250,8360,8331,8291,447,1607,1436,1369,2172,22
53,1257,
1704,2230,2691,733,1797,3204,2610,1669,1340,1231
,827,1590,934,4158,4378,4239,5125,2334,2633,1634,
1474,51
40,4199,4274,4390,2347,2402,3093,2259,882,937,24
49,3152,2233,3109,963,1419,747,1265,2444,2392,41
89,5154,
4740,4298,4688,4419,4488,4393,1119,505,1381,855,
2634,2693,924,1810,3330,2641,2583,2288,6149,6208
,4866,42
03,8278,8252,8472,8281,8482,8721,8716,8388,3098,
2254,734,829,1563,1213,2143,2375,4276,5376,4247,
4305,161
1,1363,2612,2848,1430,1258,1688,1386,965,1614,17
30,1239,8333,9232,8293,8339,8368,8334,8722,8513,
2450,240
4,938,884,4380,5123,4744,4190,506,1327,1589,1804,
2355,2349,2465,3208,749,1370,2261,3114,4300,4394,4496,4
704,2616,3168,1640,945,2880,2636,966,1456,1681,755,3083,3585,2234,2694,1266,859,5185,4448,4421,4629,2452 ,3139,2275,2944,8223,8392,8282,9248,8737,8484,8514,8724,4251,4306,4401,4643,2642,2466,1427,1593,1388,940 ,2350,2697,1214,830,2819,2408,4396,4205,5144,4280,1809,911,1621,1582,4630,5156,4633,4211,2587,2159,1832,
871,3100,2379,639,1480,5186,4263,4321,4422,1698,1335,888,1372,1245,479,1422,1268,4402,4868,4253,4752,321
6,2262,946,1732,2357,3110,1677,750,1802,1626,3332,2236,4425,4206,6153,6150,4213,4308,4267,5134,8455,8341 ,8294,8297,8496,8488,9222,8355,2497,3121,1393,969,2265,2456,2657,2644,508,1613,2599,2698,4872,5160,4426,
5249,8284,9225,8239,8459,8577,8738,8516,8400,2277,2207,861,1446,2468,2358,1857,1339,3141,2589,757,1382,3
336,2821,970,1700,8578,8342,8345,8357,8298,8247,8520,9280,2658,2705,2381,3113,1243,919,2167,3146,1594,14
33,1826,1504,875,1635,1259,862,4322,4645,5139,4634,2648,2387,1920,1675,4483,4404,4312,4512,4367,4375,616
1,6154,3232,2266,1445,758,4254,4433,4646,4768,2416,2700,1149,948,1359,1816,3079,2278,1596,1671,1712,977,
5188,4214,4428,4675,4636,5168,4485,4269,5133,4217,4649,4295,2439,2361,1385,923,1622,972,2498,2590,1434,1
311,3586,2382,4880,4275,4324,4434,1729,761,1396,877,3124,2281,2603,2822,2223,2171,3203,2706,1207,1475,26
60,2389,8728,8769,8740,9226,8305,8346,8271,8461,1449,1812,952,1686,2825,2268,495,1262,10242,10244,8300,8
770,8416,8358,8711,8744,2362,3153,1644,1619,2472,3116,1341,1429,8387,8462,9233,8833,9228,8715,8467,8772,
2443,2721,1825,703,6162,6272,4408,5632,1371,1638,1567,1736,4800,5250,6156,6177,8483,8251,10248,10256,83
61,8752,8306,8469,2631,2403,935,1685,978,1625,3344,3142,4486,4270,4650,4677,883,762,1246,503,5142,4489,4
379,4218,2335,2231,1458,925,4544,4449,4657,5192,4299,4159,4436,4490,1394,1269,2282,3099,5145,5377,4623,4
678,878,1478,735,1799,4652,4277,4391,5155,2173,2605,3264,2708,2664,2390,1678,1860,2364,3205,2289,2826,26
11,3122,1443,1637,4381,4328,6209,6164,2393,2500,1481,1373,2445,2451,3160,2255,1699,1255,993,1591,1828,14
52,3588,2722,885,939,994,1400,8348,8279,9344,8389,8308,8362,8253,9234,2606,2833,3148,2480,4220,4301,4278 ,4739,1744,1656,3087,2405,5252,4658,640
0,6178,2235,3210,980,1689,926,764,2284,2712,1270,941,1628,1367,18
05,1457,3360,2672,8723,8717,8834,84
73,8470,8718,8369 ,8485,4382,4681,4395,4450,2635,2828,3128,3170,5141,4
307,4497,5200,1921,1583,2753,2174,8580,9249,10272,10243,8283,8776,8961,8390,1387,1642,2290,3111,967,126
7,2613,2446,4281,5157,4492,4440,1484,1450,2394,2504,4682,4741,5378,4689,886,831,1683,1342,4631,4336,5146 ,4302,1811,947,2406,2453,2351,2617,3592,2292,1705,1431,3206,3145,2643,3331,507,1261,1840,889,2237,2614,4
191,4423,4660,4896,1650,984,1760,1490,6168,6180,4498,4452,2724,3217,3102,3156,8364,8312,8393,8528,12288,
12289,12290,12292,1615,751,2409,2754,2637,3392,2263,2834,8254,8474,8335,9221,9236,8295,8370,8486,6151,6
273,4403,4397,1702,942,1858,1423,2695,2396,1460,1383,4513,5256,4309,5162,2467,2454,996,1692,1641,1814,97
1,1477,2512,2728,1273,1512,1733,890,1598,1374,8285,9250,8836,8394,8784,8515,8584,8489,4664,5216,4928,468
4,2849,3117,2410,3212,509,1806,2638,2457,5131,5633,4282,4742,3334,2618,1922,1649,4500,5187,4323,4992,316
9,2836,3600,3154,949,973,2645,3123,2620,3234,1397,1489,4690,4514,4398,4745,2267,2359,2756,2646,6210,6656 ,4867,4456,10245,10304,8962,8299,8372,9472,8343,8401,4635,4207,5148,4427,3337,2649,1708,1627,2699,2469,1
000,1690,2840,2850,892,1274,5264,4310,6155,6184,2659,3095,1438,1817,2650,3220,2458,2279,4405,5158,5380,4
284,8476,9219,8840,8286,8396,8490,8592,8800,9281,8544,8517,8725,8347,8402,8497,8739,1390,1464,2736,2701,
1868,950,1151,1731,4545,5169,4313,4504,1506,1827,1597,863,3176,2296,3118,2417,4705,4692,4647,4746,1451,7
59,2238,2412,1864,1714,3616,2702,3143,2707,1701,1395,4325,4255,4516,4406,8492,8301,9240,8376,8726,9252,8
729,8307,5189,4637,6212,6274,3209,2383,2528,2363,1803,1008,2269,2418,3333,2661,1623,1482,5384,4869,4706,
4753,3456,2470,1276,510,4429,5161,4215,5194,2473,2499,1435,1652,4696,4435,5280,4314,3125,2662,2591,3346,
2283,2460,2391,2420,979,1492,3233,2823,9282,8359,8417,8518,8498,8964,8349,8848,4464,4748,5127,4326,953,1
928,1829,1389,4487,4409,4546,4638,2365,3587,1738,763,2270,3147,1872,974,5634,4430,6163,6157,6192,6158,51
72,4329,2474,2501,1453,1643,2285,3172,1713,1818,4651,4870,4271,4219,8521,8302,10249,10246,8309,8
404,836
3,9230,1215,1402,2607,3218,1629,1520,1830,1691,3
340,2881,954,1459,5251,4754,6216,6401,8968,9256,
8522,934
5,8418,8741,9235,8730,4708,4437,4873,4316,4410,5
201,4520,5164,8579,8500,8408,8608,8463,8471,1025
7,10250,
1734,879,2852,2760,3130,2882,981,1505,2709,3101,
1706,982,4491,4769,4679,4451,2856,2827,3265,2665
,2652,35
89,2481,2768,2864,3149,1924,927,3224,2884,1833,1
639,8350,8529,8742,8864,9284,8310,8524,8771,2395
,2945,31
84,2291,1447,1746,3345,2710,1343,1679,3648,2502,
2366,2723,1820,1761,5392,5190,4383,4279,4330,514
7,6165,6
276,8732,9264,8581,8365,9229,8313,8745,8391,1479
,1275,995,1740,4221,4653,5312,4756,4712,4438,617
9,6402,3
158,2666,1401,1888,4412,5253,4337,4874,765,956,3
129,2946,2829,3362,1496,1861,4659,5170,4441,4548
,3268,24
24,887,1437,4493,4499,5208,4303,6170,6657,5636,4
770,4654,4881,5196,4528,985,1720,2476,3594,997,1
630,1813 ,1462,5135,4453,4283,5258,2713,2784,261
5,3155,4332,4760,5408,4720,3240,3126,1398,1645,2
888,2673,2286,320
7,2407,2505,2447,2835,8976,8371,8420,8530,10258,
10368,8504,9728,1848,1687,2639,2726,4683,4876,51
76,5218,
8896,9346,10252,10273,8582,8366,8746,8773,1247,1
716,2482,2725,3338,3590,1936,986,9238,8585,8475,
8314,86
40,8545,8753,9288,1483,1651,1745,943,2397,3348,1
859,1508,3150,2293,3236,2506,6224,6181,4801,4222
,8395,82
55,8532,8586,9241,9473,8719,8774,8748,8373,8487,
9251,8477,8424,10305,10260,1834,1454,2714,3161,4
338,515
9,6169,6166,2668,3601,891,1841,998,1595,3211,336
1,4661,4494,4442,4552,1278,766,1465,1709,8316,83
97,8374,
8835,9348,8754,10496,10274,6280,6404,4454,4501,4
399,4665,5640,4340,2411,2175,1764,1646,5254,5193
,4691,5
379,4285,4662,4772,5265,3115,2239,3173,2830,2455
,2484,1737,511,5150,5204,4457,4802,2674,3266,148
5,1404,4
685,5440,4311,4882,2619,2513,1693,1866,2729,2294
,2755,3394,4743,4444,6408,6182,1952,1491,988,165
7,4515,4
502,6658,6240,1752,1807,2398,3132,2647,2716,3596
,2838,1399,1844,3213,3368,2508,3171,1001,951,165
4,1926,3
248,2297,8478,8777,8491,8546,9237,8403,8593,9296
,2730,3712,1707,1391,4560,4776,6211,6185,12296,1
2304,12
320,12291,8377,9253,8588,8536,2621,3219,2459,285
1,4897,5165,4458,5260,1002,1468,3164,2837,3352,2
757,241
3,2488,8778,8837,9474,8785,8727,8432,9242,8398,8
287,8519,8756,8992,10264,10276,8594,8548,6288,61
72,4686,
4505,1836,1494,1873,1271,2676,2737,1694,893,5382
,4666,5217,4884,10247,10369,8499,8493,8609,9352,
8405,92
58,2422,3272,1923,1461,2471,3604,1748,1715,5648,
5202,4693,5171,2514,2841,975,1862,4668,5282,4315
,4407,89
4,1815,3178,2298,2419,3222,1497,1653,4804,4694,5
385,4697,4747,4517,4888,4898,6213,6186,4707,5143
,2529,26
22,3396,2461,4698,5268,4506,4327,3157,2651,2414,
3593,1510,1762,3335,3103,2516,3618,1842,1375,270
3,2948,2
853,2663,4784,4749,6660,6193,3214,2732,1703,1009
,5224,4344,5166,4465,3457,2758,1466,1874,8760,93
12,9024,
8780,12293,12352,12297,12294,6218,6416,4286,446
0,3235,2477,955,1739,9227,9729,8378,8838,8596,92
83,8419,
9088,2842,2300,3162,2421,2653,3280,2896,2738,566
4,4750,5191,4755,1486,1930,2761,2680,1889,1004,1
658,182
1,5257,4431,4576,4411,1718,1929,3364,2530,2854,3
180,1599,1507,8786,8610,8494,8841,10306,10752,89
63,8552,
3131,2475,1776,1405,3225,2952,3617,2462,8731,830
3,9244,8523,9360,8406,10251,10280,4317,4466,5381
,4709,1
735,1831,3339,2271,3174,3602,1493,1010,5504,4518
,6304,7170,8501,9254,9476,8380,8641,9265,8409,86
00,4521,
4547,6664,6432,2711,2740,2883,3376,5173,4710,463
9,5394,1984,1455,2667,2520,4331,4508,4439,4468,9
57,1865,
3185,2503,8801,8788,8743,8842,8421,8351,8612,850
2,6672,6336,5281,4871,2844,3237,3649,2857,4413,5
635,431
8,5195,4522,4549,4333,5220,2762,3296,2769,2885,2
764,3134,983,1710,3350,3400,958,1514,4655,5266,6
688,6214 ,2912,2858,3221,2654,1876,1768,3242,296
0,9285,8733,10308,10370,12305,12298,12306,12416,
5388,4929,4900,4
808,1721,1938,3151,2770,9480,8965,8802,8849,8525
,9257,8311,9290,2744,2425,1660,1500,5178,4930,47
57,5149,
6188,6275,6225,6194,1403,1892,3472,2483,1819,174
1,1516,987,4904,4875,5313,4713,3341,3608,1932,14
63,2865,
3177,3840,2367,1012,1843,2669,3228,4700,5637,452
9,4816,8792,8531,9376,8410,8560,8844,9223,8422,4
912,519
7,6217,6159,5272,4932,4443,4993,1749,999,2860,25
32,3393,2478,3620,3186,5232,4339,5393,4758,3347,2886,271
5,3267,5696,4550,4414,4771,1838,1277,2536,3159,6464,6277,5206,4714,2287,2426,2507,2670,3458,2675,1647,19
25,2485,2428,1498,1742,8583,8505,8642,8734,9730,8526,10259,10253,5177,4994,4877,5410,3249,3656,2866,322
6,10288,10254,9268,8425,8747,8966,8367,8315,5316,4472,4524,5642,6196,6167,4761,4832,1513,1880,1717,1016,
4663,5203,6278,6528,5288,5174,6220,6281,1953,1837,3342,2509,1867,1631,3591,2544,4936,4721,4334,5255,934
7,8850,10312,10497,8804,8533,8969,8412,8506,9297,8616,9260,8587,8865,8775,8547,2717,3238,1469,1747,3365,
2727,767,1904,4455,4553,4495,4883,1724,1524,3188,3127,6226,6200,4687,4774,4530,4773,5386,5638,12300,123
21,12353,12308,9488,9286,8479,8375,6171,6241,4445,5396,989,1406,1754,1822,3269,2772,2889,3353,5198,4341,
5284,4554,8426,9243,10261,10372,8317,8749,9408,8852,2677,3632,2399,2515,4762,5209,4716,5649,3408,2486,3
163,2785,2299,2510,2490,2489,1835,1499,3714,2517,3597,2295,2731,3244,5259,5409,4459,4223,1944,1863,1890,
1467,8808,8534,10275,10498,8508,9349,8433,8970,1003,1522,3274,2890,3460,3175,2786,3192,5163,4287,5221,4
878,4503,4532,6183,6403,1763,1695,3356,2947,4722,5314,6228,6282,8755,9266,8537,8644,8589,8595,9304,8399,
4667,4561,6289,6405,3650,2718,1850,990,4777,4342,4803,5442,1005,1937,3366,2831,3133,2897,1722,1845,6173,
6187,6242,6659,4446,5180,4695,4764,3603,3241,1495,1655,10266,10753,9732,8866,8750,8977,9292,8624,5644,4
886,6232,6284,5261,5416,4556,5219,9231,8549,8379,9354,8428,8856,9504,8816,5296,4345,4778,5760,2868,3624,
2776,2976,2839,2415,1765,1956,4669,5267,4507,4899,3424,2949,1487,1750,5212,4885,5400,4805,8779,8972,927
2,9314,10320,10277,8897,8318,3281,2678,1869,1521,3369,2733,2892,3252,8434,9255,10265,10262,8757,8590,85
38,8648,4461,4536,4724,4785,2681,2759,959,1896,6174,6290,4470,5320,1263,1940,3166,2301,10376,10500,8550,
8597,8495,8761,9736,8436,2739,3349,2872,3223,1770,1877,2950,2734,3716,3270,1509,1711,3464,3181,2788,339
5,9350,9289,8787,9475,8381,8758,8868,9361,7172,6215,4519,5652,1756,1846,2898,2423,4562,4889,6406,6409,36
06,2492,1011,1960,3354,2518,3215,2531,6305,6720,5226,4346,9246,9300,8553,8898,12544,12322,12312,12324,8
781,9536,8407,8978,8839,8540,10504,10278,4467,5270,6189,6244,3595,2463,1784,1870,4577,4670,5444,4509,52
05,4699,4462,5641,1662,1013,2533,2953,5383,5151,4564,5666,8611,8598,10754,10336,8656,8872,10307,10281,4
751,4996,4901,4711,1985,1753,3250,2843,5262,4780,5505,4806,2521,3288,2682,2792,6784,7169,5283,4525,1927,
1528,3664,2900,6195,6292,4890,4348,1849,1882,3008,3370,5210,4469,4701,5328,4944,4786,6190,6219,2913,274
1,1766,1511,4809,4728,6410,6417,3179,3842,3398,2845,3273,3652,3619,2954,1954,1719,3300,2763,3189,3378,17
77,895,8993,9261,8554,9356,10384,10268,8782,8601,5412,4578,4902,5228,2855,2522,2684,3227,9478,8762,9313,
8980,9744,9298,8789,9267,8764,9378,8411,8503,12295,12417,12354,12800,6661,6248,5179,4523,2742,2302,1439 ,1006,8900,8790,9481,8793,8843,8613,8984,8994,5273,5000,5665,4510,3598,3713,1878,1891,2765,3119,3363,262
3,6306,6197,5387,4319,2961,3488,2846,2859,2427,3256,1939,1661,10309,10282,8803,9239,8794,9364,8602,8423,
8880,8845,10756,10289,9320,8440,9262,8561,10314,10512,8382,8556,9760,8846,9287,8851,5222,5650,4759,4788 ,3401,3239,1502,1986,2745,3612,1852,1934,4931,5424,4715,4568,2479,3190,2655,3276,6337,7176,5233,4551,935
3,8527,8672,8507,8413,8562,9477,8805,2537,3372,1723,1772,2914,2771,1515,1897,6296,6221,4892,5285,5697,49
05,4810,5344,4817,4933,4812,5182,6308,6912,5398,5448,2534,3621,3229,3282,4960,4906,5269,4702,2956,3841,3
609,2766,1014,1470,2861,3412,5290,5008,5199,4818,1743,1931,2524,2904,4792,4473,6412,6418,3165,3459,2887,
3377,5520,4531,6662,6198,3343,3194,2773,2746,5389,5656,4913,5225,3520,2962,1017,1968,12299,12328,12356,
12418,9600,8614,10400,11266,3297,2800,2916,2867,3397,2862,2487,2977,8617,8643,10760,10528,12307,12301,1
2336,12302,5888,4415,4717,5276,1881,1894,3245,3626,1769,1517,2538,3187,6227,6201,6665,6256,9269,8806,87
35,9490,8427,8604,8535,8564,1778,1941,1823,1659,3728,2671,1992,1875,10768,10432,9377,8967,8509,9731,841
4,9291,4908,4580,5441,4526,3680,3384,1755,1501,8618,8645,8429,9316,8751,9362,10784,10310,9484,9025,8996, 8904,9274,9026,8853,9245,2719,3246,3410,2787,5668,5234,7168,6279,10284,10371,10321,10290,9000,8971,9409 ,8809,1018,1900,3651,3605,1725,991,3461,2964,8796,9733,8625,8912,9008,9293,10313,10255,5395,4934,4763,5315,6222,6433,4584,5207,4335,4474,4555,4718,3351,2511,3284,2891,5506,4723,6338,6229,4533,4476,5297,5704,4914,5274,6420,6666,3183,2429,3720,3402,9368,9028,8539,9089,12360,12545,12309,12420,5390,4557,5639,4592,2545,3634,2978,2869,4765,5286,5413,4775,6202,6312,5236,5175,2774,3009,3251,3230,1933,1839,2920,3466,2540,3298,3380,2679,6283,6243,5317,4820,1525,1955,1988,1884,1726,1948,3622,3271,4937,5401,4725,5680,6230,6204,4447,4563,9328,8435,9489,8854,9792,8646,8510,8867,2777,3193,3653,2748,6424,6233,5456,4534,10560,10373,9302,8810,12323,12546,12314,12801,5211,4833,6434,6673,1780,1518,3844,2491,1020,1767,1905,1851,4347,4558,4538,4537,3355,2789,1893,1945,3426,3610,3404,3253,2893,3367,2968,2430,6668,6340,5762,4565,9273,9090,8973,9506,9412,8568,8620,9738,5645,4343,4779,5292,6285,7184,6245,6291,10292,10263,8857,8928,8759,9299,10374,10624,3633,2870,3473,2899,5322,4938,5508,5223,3277,2778,3657,2546,4834,5240,6320,6286,1757,1530,2928,3304,5404,4995,5698,4766,9384,9270,10316,10377,9032,8817,8430,9351,2790,2493,3440,2519,5414,4879,5181,4945,8551,8649,8591,8979,10322,10296,8783,8870,1958,1471,1007,2000,2683,3196,3744,2980,8626,8869,9482,9734,10267,10337,8541,9492,3628,2735,1847,1898,5651,5289,4916,5672,4824,5024,4887,4463,6674,6465,5472,4997,3258,3468,3660,3373,6175,6344,6234,7200,5329,4726,6689,6436,1523,1942,3848,2951,3182,2873,1961,1871,5417,4781,4940,5300,9294,8437,9380,8650,8858,9305,8812,9745,3283,3409,1771,1529,2548,3625,2894,3718,12368,12325,12313,12310,9355,9505,8555,8319,4729,4807,6466,6676,6407,6293,6246,6249,3243,2793,1912,1758,5214,4349,4787,5397,4920,5271,6448,6440,4998,4782,5764,5318,12424,12548,12552,12326,9259,8383,9317,8974,2874,2780,1989,1946,3312,2494,3010,3474,5512,5229,4836,5443,3668,2984,3425,2523,8599,8628,10279,10499,8818,9410,10324,10378,4946,4471,5654,4540,1526,1906,2901,3358,2915,2685,3599,3278,1883,1773,3462,2955,5402,4566,5263,4579,3254,3715,3636,3381,2535,3856,1957,1853,2743,3489,3135,2794,8763,8657,10385,10501,8873,8438,8899,9538,5643,4511,7174,6307,4581,5001,6236,7177,1976,1015,2876,2801,5298,4891,4569,5336,10269,10283,10338,10755,8542,9276,8791,8860,6191,6411,4730,4840,3658,2902,3285,3374,9740,8982,10328,10380,9357,9512,8652,9315,6529,6690,5712,4948,6468,6352,6530,6294,1751,1993,1503,1962,5056,5418,6297,6309,4961,4789,6250,6199,2905,3416,3257,2552,9392,8441,8874,9856,8765,9363,8603,8995,5227,5890,5446,4893,5321,5700,5667,5002,12802,12384,12355,12329,9308,8981,9496,8901,8557,8632,8820,8881,10270,10386,8566,9416,6472,7232,5348,4811,2847,3403,2303,3012,5237,5426,4903,4570,1781,1885,3290,2957,4732,5275,4790,4350,1908,2016,3721,3607,11268,10311,8615,9748,12432,12316,12357,12330,5646,5761,6680,6721,3357,2767,3191,2525,4813,5167,6692,7178,5411,4671,5009,5536,8658,8985,10502,10505,10401,10816,9322,8442,3665,2963,3496,3428,4894,4907 ,4475,5304,2686,2796,1854,1532,2992,3776,3379,3275,8563,9366,10285,10340,8673,8766,9540,8605,2917,3640,3476,2539,2747,3301,1972,1774,6257,6298,5449,5287,6223,6413,4793,5660,9301,8795,8558,9737,9479,9247,8660,9762,3399,2802,1019,1895,4527,5238,4703,5324,3231,3613,2906,3666,6252,6722,4585,5420,6368,6310,4962,4819,3465,3524,2526,3016,8847,9092,8997,8807,9358,8876,9601,8902,10880,11265,9379,8621,12804,12337,12362,12560,6663,6696,4582,5669,5277,5330,5004,5889,3308,2431,1987,1969,5657,4814,4909,5460,6339,6414,4572,4952,3260,2958,3849,2863,10291,10388,8986,8444,9306,8565,8797,9424,7185,6785,5213,5507,3627,3024,1782,1279,9040,8882,10286,10315,8905,8824,10506,10513,4935,5425,5391,5242,2918,3732,3681,2965,9508,8674,8998,9324 ,10757,10344,9275,8619,7180,6667,4821,4794,5568,5010,6419,6724,5345,4848,4964,4915,5445,4910,4535,5025,1943,1899,3385,3289,6435,6203,5293,5674,9369,9096,9761,8606,10402,10293,9483,8415,1994,1663,3654,3872,2775,3198,3490,2541,9318,9746,8855,8884,9027,9520,8811,8664,4586,5235,6313,6704,3405,3299,1964,1785,5776,4719,6258,6421,3724,2921,1021,1935,10433,11272,9329,8647,12448,13314,12808,12576,12816,12480,128

32,1235
8,10392,10317,8988,9381,5728,5432,4767,5294,3432,2749,3614,2979,5458,4835,6300,6231,3371,3846,3413,3521,
9793,9001,8906,9440,8913,9029,8908,9278,2804,3382,2908,2547,5699,5653,7296,6341,2779,3696,3286,2871,362
3,2970,3247,3722,6260,6314,5509,5012,1886,2001,2922,3480,10404,11008,9494,9544,12332,12419,12369,12338,
9056,9002,9365,8798,9386,9104,9295,8914,8888,8569,10508,10514,9616,8627,10758,10294,3469,2966,1407,1779 ,5399,4559,5332,4939,6205,7186,5231,4477,1990,1970,3684,3302,5768,5450,6675,6669,2550,3843,1879,1022,948
5,9752,9009,9321,9984,8511,8813,9372,4593,5682,5026,4917,6786,6425,4822,5057,5299,5278,6422,6670,4968,55
14,4588,5346,5428,4727,6321,6437,2981,3414,1902,1947,6532,7201,5670,5319,3386,3730,3635,3259,4825,5241,5
701,4796,6235,6728,5892,4539,3536,2791,3406,2808,6913,6342,5403,4837,3292,3629,2929,3195,6316,6264,5474,
5658,5452,5301,4941,5415,2542,3427,3320,2750,10323,10297,10761,10352,9004,8676,9537,8622,9764,9330,1126
4,10375,12361,12303,12608,12421,2969,3672,2549,2924,1759,1907,3463,2895,9491,9030,8859,9411,10318,10529 ,8680,9303,8431,8570,8651,8814,12340,12311,12422,12672,6345,6480,5016,4478,3904,3492,3040,3745,9602,881
9,10434,10325,8629,8572,9393,9800,1527,1996,1786,1959,6206,6426,5681,4918,5521,4947,6287,7173,2495,3655,
3484,3417,9010,9370,10516,10762,9486,8653,9735,8688,7188,6247,5325,4826,2002,1913,3305,3752,8861,9382,9
509,8871,10298,10408,9332,9271,12364,12425,12370,12344,10379,10339,9413,8916,9033,9497,8821,9776,10326,
10300,8543,8659,1949,2017,2781,3845,5705,4594,6322,6438,1534,1788,3717,3388,3279,2875,3638,2982,10520,1
0329,9552,8630,9307,8929,10530,10769,4976,5352,4838,4541,5488,4567,6237,7202,8443,8654,8634,8633,10764,
10436,9858,8661,6788,6346,6736,6467,3682,3522,2930,2985,4731,5244,5792,5028,5676,4783,6536,6441,5306,55
16,5708,5421,5896,4999,5230,4921,3011,3467,2795,3313,5331,5457,4596,5673,9741,8439,8875,9388,10381,1128
0,10341,10387,3167,2553,3429,2903,4942,5766,5291,4841,6914,6251,6324,7424,2972,3858,1910,1965,2782,2877,
3611,3261,3659,3411,2004,1901,4922,4828,6295,6353,3478,3306,3736,3434,6428,7171,5360,4542,6792,6
238,505
8,5522,12315,12385,12327,12547,9418,9034,9604,9319,3013,3662,3778,3287,5716,5032,6348,6442,8930,9336,10
416,10382,12372,12426,12433,12549,5473,4571,6544,6752,1966,1775,2986,2932,2008,1531,2554,3375,7233,6496 ,6469,6677,9500,9091,9794,8862,9510,8975,9277,9041,3637,3852,1971,1950,2797,3418,3688,2993,12317,12331,1
2386,12803,9747,9385,9012,9768,8920,9120,8983,8559,10770,10561,9568,9093,4949,5406,4963,4733,3014,3504,
3729,2803,10271,10440,10330,11296,9425,8822,10785,10532,9513,8877,9036,9396,8825,8903,10562,10772,6299,
6354,5647,5326,6449,6691,5510,5003,5302,5763,5684,5429,3314,2907,1909,1991,10503,10389,10342,10345,9310 ,8445,8883,9493,4583,5904,6444,6253,3475,3641,3436,2988,9016,9367,10544,10536,9094,8878,9860,9414,4791,5
537,5183,4842,3262,2878,3857,2959,4924,4849,5706,4950,5333,5422,7192,6328,9608,9325,8932,9539,12376,124
28,12318,12434,3669,3630,3880,2919,2018,1727,2687,3528,9042,8567,9750,8636,13316,12359,12550,12553,3746 ,3383,2936,3420,4953,5464,6678,7204,5305,4600,4895,5451,6681,6259,4351,5060,3293,2527,3470,3316,7234,631
1,6369,6470,5338,5005,6450,6916,1916,1855,1974,1995,2994,3780,3725,2798,6301,6800,5769,5655,5405,4815,64
73,6254,3850,3674,3441,3017,9498,8662,9359,8675,12449,12864,12333,12388,5239,4573,6261,6356,5713,5011,5
544,5476,9739,8607,11270,10403,8677,9097,10332,11273,2020,1977,2556,3661,6315,7182,4734,4844,6920,7208,
5040,5824,5427,5323,4965,5688,12928,13313,12339,12436,9394,8987,8665,9432,2909,3494,3905,3387,2805,3430 ,3018,3748,5524,4587,4795,5349,3291,2967,1787,1914,10287,10507,8826,8936,10625,10786,9808,9044,5447,485
0,6474,7297,3642,3481,3874,3552,5279,5661,6370,6693,2923,3683,3307,2910,10564,10448,10626,10390,9152,95
14,10393,10405,4954,5714,5513,5572,2005,1887,3968,3723,9057,8885,10346,10295,9323,9986,9542,8989,1023,1
963,3493,2806,7187,6682,4574,5064,5356,4479,6531,6452,3197,2996,3407,3864,9417,9796,9763,9098,10568,113
28,9444,8907,9333,9522,8999,8666,8828,9371,8886,8446,12334,12363,12554,12561,9742,9857,10776,10817,5308 ,5006,5897,4911,6360,6560,5675,5072,8909,9263,10788,11274,9507,8767,9105,9632,6415,6423,4966,5780,5729,5
013,6302,6481,3644,3719,3760,3025,6694,6816,7236,6262,5433,5337,6476,6723,3433,2971,3670,3020,57

02,5920,
4823,5246,5538,4589,5453,5347,8990,9003,8571,9400,12805,12392,12450,12341,6684,7216,5772,4969,3482,3359 ,1998,1783,10353,10394,9545,9383,10319,10509,8889,9756,6533,6317,5480,4797,3777,2809,3444,2925,12481,13
320,12440,12365,8623,9334,8799,9420,7181,6265,5662,5027,2024,1980,3255,3523,5419,5894,5461,5569,6697,63
43,4852,5430,4956,4595,6928,6323,4827,5744,5334,4919,10348,10818,8681,9516,10464,10406,9058,8915,3497,3
860,3000,3734,5671,5018,5295,5770,2543,3310,1903,1973,3692,3667,3389,3477,10759,10792,8678,9765,9373,94
26,9100,9985,3873,2751,3419,3686,6372,6482,4970,5528,5517,5014,6456,7680,3615,3784,2983,3733,6848,7298,5
732,5350,3026,3673,2931,2810,6534,6318,4598,5891,6698,6725,5029,5462,9753,8910,9005,9556,10435,10510,86
68,9048,3294,2551,3506,2973,7190,6537,5434,5778,6427,6266,6592,6497,3442,3317,2003,1789,11281,10881,930
9,9603,12452,13056,14336,14337,9031,9521,9487,9338,12556,12562,12806,12342,5683,5307,5584,4839,5454,485
6,6705,7240,11276,10763,8917,8890,9664,9106,10515,10820,2926,3526,2783,3847,5340,5677,4977,5243,9441,89
44,9060,9011,9541,9006,8631,9121,1997,2032,3726,3908,6347,6207,4590,5475,12371,12345,12809,12400,10531,
10299,9389,9770,5368,4798,6484,6538,7193,7425,5017,5720,8682,9331,10409,10800,9872,8815,10354,10517,982
4,9528,8863,9390,9554,8931,10396,10327,4597,4972,6671,6726,5511,4943,5952,5540,5088,5793,6700,6325,1978,
1917,3491,3685,6439,7203,6429,6376,2010,1519,3529,3421,9795,9749,11392,10437,13312,12423,12366,12577,45
43,5703,5532,5465,6268,6349,5353,5800,3747,3303,3041,3639,6326,6787,4829,5893,10356,10410,9605,9108,949
5,8655,9428,9035,3876,3500,2933,2987,7300,6706,5765,5436,5327,4923,5686,5030,3042,3448,3792,3704,10301,1
1282,9327,8573,9864,9546,10771,10765,12482,12373,12564,12810,12346,12456,12427,12387,3028,3737,2974,28
12,6430,6729,5730,5570,3318,2989,3676,3415,3853,3505,2019,2006,8689,9778,9122,9013,10882,10521,8918,915
3,6443,6498,7189,6355,3969,3631,3435,3690,4978,5033,6545,7248,6329,7205,5059,5515,1951,1911,3015,3315,48
43,5361,6540,6488,9395,9374,10518,10766,9064,961
0,8684,9442,9524,8823,10417,10533,12374,12348,12568,123
77,10628,11297,9766,9415,8921,9337,9797,8892,3532,3498,2021,2009,5215,4601,5477,4951,6730,6789,5020,590
6,7426,6737,6679,6384,10331,10824,9988,8635,11009,10438,9499,8933,7194,6350,4830,4925,5659,5309,6239,64
71,10412,10360,9570,9754,9548,9397,9037,9511,2934,2879,3731,3390,5707,5459,6708,6944,12578,12817,12812,
12484,10441,10576,9112,8574,5526,5354,5784,5482,5061,5710,5826,5335,6546,6500,5034,4980,3859,2995,3753,
3479,4602,5423,5685,5900,2555,3309,3888,2937,10302,10522,9777,9014,9617,9043,10383,11269,6451,6445,6561 ,7304,4845,5466,6357,7210,11284,10343,9421,8922,9801,8690,10418,10534,12429,13328,12389,12435,9072,9448 ,8934,8637,3698,3032,3808,3538,3663,2799,1790,2026,9584,8663,10333,11298,12464,12430,12818,12609,10884,
10442,10832,10563,12319,12488,12378,13344,3750,2990,3906,3471,6712,7264,5736,5041,3508,3431,3044,3740,6
976,6732,5062,5552,8827,9340,9888,9124,9772,8879,10632,10537,5777,4851,7179,7681,3689,3862,3019,3525,63
30,6790,5362,4955,1975,2012,3321,3560,9402,9612,9804,9517,9992,9095,9326,9017,3781,2938,3646,3422,6548,7
235,6371,7040,12833,12580,12610,12820,9427,9553,8692,9769,9038,9862,9387,8937,11010,10347,10420,11520,1
2551,12437,12390,12393,9018,8924,10391,10449,1967,1915,2557,3854,3970,3697,2997,3021,6738,6562,5523,568
9,5484,5036,6446,6793,10524,11267,9456,8638,10888,10334,9154,9618,5310,4926,6915,6504,5905,5007,5717,56
78,9812,9128,10444,10538,9569,8667,10640,10848,6683,6255,5928,4967,7196,6475,4735,5576,5794,5431,4984,5
468,5341,4575,5518,5364,3445,3537,3756,3675,7312,6358,5042,5828,6453,7206,5773,4846,5898,5722,7428,6332,
11329,10592,10565,10773,9045,9502,9059,8829,3048,3738,2940,3322,3486,3865,3438,3512,2025,2022,3916,2998 ,6593,7217,5489,5065,6361,6552,6753,6740,4604,5709,6695,6794,10395,10450,9743,9422,10545,10787,9606,909
9,9398,9859,9780,9525,12592,12584,13318,12451,3199,3779,3554,3875,6373,6303,4957,5542,8679,10000,10540,
10349,12380,13321,12335,12555,8887,9633,9279,8938,12673,12834,12612,12496,6564,6454,5953,5435,3645,291
1,1981,1918,9020,8945,9802,9046,9429,9518,11288,10424,2033,1999,3499,2807,7237,6685,4853,5478,74

32,6917,
5066,5796,3912,3762,3749,3443,12674,12438,12441,12453,12394,12343,12616,13376,9049,9560,10774,11300,94
01,8696,8991,9547,6754,6801,6477,7209,3851,3056,3671,3530,10777,10355,8447,9156,12824,12865,12836,13322 ,11330,10407,10465,10566,9434,9101,10546,11012,10397,10896,9865,9751,9501,8911,10569,10350,5339,5015,62
63,7242,5690,5529,5922,5600,4971,5731,5355,4958,3324,2558,3483,3700,9335,8669,10357,10452,9809,9107,964
0,9572,6744,6483,6016,5771,3027,3540,3001,3976,10411,11278,8830,8940,11016,11304,9136,9920,7328,6362,55
41,4854,3877,3437,3786,2811,6512,6796,5245,5044,5455,5912,7175,6374,9523,9419,9061,9784,9620,8683,8891,9
445,5692,5767,5808,5073,2028,1533,3920,3022,12401,12442,12367,12557,9543,8946,10570,11393,3501,3691,376
1,3866,6535,6457,5481,5019,5718,5068,6594,6686,5530,5407,7682,6478,3263,3450,3677,3568,5825,4857,5492,49
73,7220,6377,6699,6918,3878,3739,3002,3507,6319,6267,7299,6802,5303,5571,6756,6485,14338,14340,12396,12
866,9375,9757,10466,10789,3782,2927,3029,3553,5545,5908,5048,5782,9050,9810,9609,9668,12512,12454,12807 ,12840,6921,6364,4591,5358,2011,1982,3754,3030,6458,7249,5740,5715,6568,7212,5437,5525,12483,12558,1332
9,12929,11283,10778,8670,9160,9452,8575,10627,10548,13324,12811,12563,12868,6539,6817,5921,4799,3972,29
75,3881,3687,9404,9102,9993,9007,10456,10656,9771,9168,10511,10519,9062,9876,9825,9109,10398,10577,3495 ,3794,2034,1979,5467,5734,5663,5832,10790,10912,11332,10358,9529,9433,10572,10819,9798,10016,8919,9342,
9634,8685,9549,9443,3391,3727,3868,3809,6727,6499,5031,5781,10780,11312,9868,9065,10629,10413,9576,8893 ,5074,5721,7440,7238,4979,4858,5342,4599,12579,12347,14344,14352,11277,10361,9758,9123,3527,3323,3043,3
788,6431,6327,5554,5021,12457,12848,12402,12565,9515,9990,9557,9665,3449,3936,2813,3004,5490,5365,6378,
7195,10793,10439,8948,9526,9052,8691,11024,10419,8923,9840,9430,9015,12444,12375,13440,12485,4974,5574,
4831,5895,3544,3909,2935,3485,9767,9114,9391,9866,12404,12458,12349,13330,6269,6701,7360,6804,6760,6486 ,5774,5956,6460,7301,6385,6922,6707,7218,5539,5733,3033,3768,3045,3678,6489,6596,5577,5469,6541,6547,725
6,6351,3861,3510,2023,2013,10468,10578,9066,9624,9613,9110,10552,11776,5795,5351,5089,5687,5924,
5548,76
84,6818,12819,12813,12930,12569,10944,11394,9828,9446,4981,5035,5090,5496,3446,3693,2036,2007,10630,104
14,8694,9987,10794,10821,9125,9558,6702,6929,7244,6576,3896,3735,3295,3764,5840,5752,7183,6501,6331,730
6,5076,5785,12566,12814,12465,12581,11286,10633,9530,9874,5022,4860,6380,6808,5366,5037,5724,5463,5901,
5553,7456,6768,3984,3034,3531,3699,10523,10362,10688,10593,9779,9403,9680,8935,6731,6924,7224,7266,3793 ,2991,3907,3556,6017,5679,6849,6270,3882,3502,2939,3889,9550,8952,10801,11336,9436,9773,9073,9339,5483,5
738,6386,7207,5063,5363,6709,6542,12676,13345,14368,14339,10443,10303,8686,9571,5580,5546,6490,6600,304
6,3643,3326,2814,4982,4927,5779,5438,3513,3757,3812,3694,12379,12872,13057,12486,9464,8894,10580,10634,
11289,11521,9113,9816,8693,9068,10767,10822,9607,9039,10048,9636,9184,9889,10796,10421,12460,12408,124
89,12624,10535,11299,10525,10472,5907,5043,6502,6549,6447,6713,7688,6388,8639,9799,9628,9561,10364,1044
5,9449,9896,5801,5527,7302,7241,6739,7427,4603,5357,2030,2014,3785,2559,5936,4985,6333,6710,10422,10883,
8925,9989,11396,10802,9861,9532,3533,3452,3741,3914,5746,5080,5856,5586,9423,9019,9782,9126,12350,12570 ,12431,13317,6820,7313,7198,7252,5711,4847,6505,6850,10526,10825,9826,9666,13332,12391,12466,12582,6733 ,7488,6359,6930,5798,5038,5954,5519,10539,10594,11285,10451,9074,9129,10641,11344,6791,6492,5556,5479,2
040,1535,4000,3539,6563,6550,5092,5788,5737,5910,5067,5573,6608,6824,5369,5608,5829,4986,5694,5470,1042
5,11301,9155,9611,8939,9457,10636,10584,3036,3705,3800,3855,6945,7213,6506,7308,3447,3892,3049,2999,460
5,5902,6734,6553,12381,13346,12932,12490,12880,12611,12680,12585,3702,3974,3755,3439,3050,3516,3884,354
2,7430,6714,6018,5745,3921,3319,3742,2941,9311,8697,9573,9047,10826,10885,9116,10002,7265,6932,7696,725
0,3971,3509,3796,3763,5045,5069,6741,7219,6716,7330,5493,5585,11522,10833,10775,10480,14341,14400,13058 ,12395,2027,2029,3023,3910,6363,6455,6852,6742,2942,3863,2035,2037,7433,6745,5804,5723,11290,10446,8926,
9021,9755,9405,10335,10567,12468,13568,12439,12497,9803,9555,10804,11040,9622,9450,9880,9578,9157,9806,
9922,9431,6795,6565,5096,5786,6936,6946,4988,537

0,10642,10596,9130,9076,12572,13315,12936,12382,8698,95 19,9781,9996,10547,10541,10657,11400,8941,9562,10453,11306,12492,12586,12688,12896,6755,7191,5534,5913, 6746,7316,6554,6375,10808,11360,9832,9137,11072,10828,9158,9648,5486,5560,6832,6797,5964,5046,5247,5827 ,9873,8947,11275,11777,10426,10886,9458,9051,13377,12640,12613,12821,10644,11331,10467,11136,5602,5923, 5693,4959,7272,6392,7214,6513,3545,3701,3558,3810,5547,4855,6334,6508,5960,5810,7712,6798,7239,6803,579 7,5491,12443,12498,12593,12835,10834,10658,9619,9785,3890,3423,3751,3057,3514,3922,3003,3787,3534,3978, 3937,3052,7305,6479,6624,6459,9580,9132,10542,10889,9406,9022,11011,10600,12588,12397,13336,12472,1000 1,9103,9813,9774,5899,5104,6365,6514,7429,6757,5719,5578,12822,13348,12825,12403,10779,10351,10024,9063 ,11292,10571,8831,9672,13378,12455,12513,12614,3706,3869,3766,3977,7552,6566,5372,4606,1791,2038,3647,3 555,3824,3453,3783,3879,9890,9527,9080,9564,9437,8671,9614,9460,6569,6595,5531,5748,3541,3058,4032,3503, 7221,6758,6687,7442,6379,6556,6487,6516,5075,5588,7329,6919,5049,6024,5925,5485,12594,13060,12445,12944 ,11408,10454,9138,9924,10549,11302,9869,8942,9994,9818,11524,10428,12617,12398,14345,14342,12405,12500, 12459,13326,6461,7683,5834,4859,6366,7243,5968,5070,10689,11313,9585,9161,10457,10648,10849,10836,6570, 6597,5549,5739,6381,7268,5809,5914,8700,9805,10791,10890,13064,13352,12618,13441,3005,3913,3031,3758,53 11,5498,6703,7314,10469,10399,9053,9638,10660,10550,10049,9531,5725,5616,5926,5787,7436,6977,5050,5555, 11333,10781,8949,9574,11528,11013,9162,9892,3006,3562,3924,3816,2041,1919,3769,3986,5830,4975,6948,6856 ,7226,6978,5077,5601,6805,7197,5802,5078,3708,3548,3451,3940,10850,10897,10573,11305,9435,9111,10359,11 338,9786,9625,10018,9696,9067,9827,9451,9054,12514,12837,13331,12826,10840,10579,10112,9867,6952,6923,7 361,6761,6748,7685,6577,6864,12675,12596,12504,12704,12559,12567,14353,14346,11424,10458,9637,8950,124 46,12625,12838,12960,3867,3789,3564,3035,6960,7245,6020,5023,7320,6980,5929,5735,3980,3511,3060,3891,10 608,10892,9341,9140,9551,10008,11271,10470,6491,7041,7280,6387,3797,3047,3886,3325,5543,5842,7441,6806, 5439,5775,7744,6598,9788,9863,9904,9169,13380,12406,12620,12867,12828,13360,12677,12461,13325,12409,12 841,12487,6462,6819,5916,5857,3695,3973,3546,3790,10631,10553,9577,9115,9814,9164,10690,10782,9626,9503 ,11778,10574,13072,12467,12516,12626,9921,8953,9588,9069,11316,10473,10795,11014,5575,5371,5091,5836,35 61,3928,3765,3064,7254,6762,5497,5984,4861,5052,7225,7042,10415,10363,11395,10898,9399,9667,10852,10581 ,6925,7458,5592,5957,7364,6520,4983,5533,9641,10004,9144,9878,11017,10460,8687,9454,4001,3885,3915,3679, 5081,5816,6572,7690,5093,5726,5909,5558,6809,6880,6711,7251,3517,3795,2815,3952,7336,7222,5494,5741,105 54,11345,9836,9811,10664,11308,9533,9621,6984,6769,6382,7303,6503,6601,6543,6931,5944,5783,6735,6822,37 72,3572,3037,3454,5343,5812,6578,6821,7434,7686,6032,5082,10635,10913,10017,8895,14354,14464,12600,1382 4,9563,9830,9759,9928,12992,13442,14348,14369,3802,3870,2042,2039,5579,5747,5841,5039,10823,10595,9127, 9877,9170,9817,11536,11334,12678,12462,12842,12869,9075,8954,9438,8695,6493,7444,5955,5604,7246,6389,73 32,6602,13334,12681,12571,12410,10527,10423,9650,9117,12736,12641,12849,13384,12491,12351,12628,12682, 3883,3547,3992,3911,3938,3515,3051,3570,9586,9461,10474,11291,13337,13569,12815,12870,9070,9670,8927,99 91,12844,12469,12583,13347,5930,5550,6810,7257,6764,7697,4987,5937,10365,10797,11456,10900,10856,10582, 9870,10052,10556,11397,10481,11018,10803,11314,9635,9829,12573,12520,14401,14356,10585,10692,9673,9565 ,5094,5691,7307,7457,5374,4862,5561,5805,10637,10643,11352,10447,9891,9447,9185,9783,3811,3743,3898,303 8,6507,6271,5860,5742,10020,9644,11780,10914,9077,9131,9186,9592,3053,3985,3770,3893,7211,6335,7269,692 6,10798,11025,11340,10672,12412,12493,12470,12931,6551,6580,5833,4607,6770,7362,5581,5500,9936,9848,112 79,10597,13444,12850,14592,14370,10427,11402,9172,9881,9118,8956,10476,10904,6715,6609,5789,5962,6825,6 390,6851,7490,9462,9133,9820,9559,9997,9649,11552,10864,6048,5587,5084,5753,3543,3703,3813,4004,5848,59 03,6494,7228,6743,6812,7692,6934,5495,5940,7309,7464,6604,7267,5097,5047,5750,6022,7344,6393,3535,3798,3 917,3569,12574,12873,12587,12642,10827,11020,11

320,11362,13333,12499,12689,13392,10113,9775,10945,1036
6,6826,7808,5803,5487,2044,2043,3007,3944,9579,9834,10482,11303,9159,9459,10805,10638,6717,7315,6555,69
47,5098,5564,7260,6933,12473,13349,12684,12632,9676,9642,10586,10696,12874,12933,13570,12881,9078,9023,
9875,9534,7448,6853,6509,6584,5932,5590,5969,5367,12823,12528,13338,12494,10003,9139,10598,10645,10543,
10809,11784,10484,9897,9623,11398,11337,6772,6833,5790,4989,3311,3988,3818,3925,10835,11523,8699,9453,1
0032,9081,10429,10806,12383,12615,12852,13088,9842,9176,9952,9682,6518,7368,6019,5557,6567,7700,5844,58
11,14360,14372,12690,12644,10916,11409,11294,11348,6610,6937,5071,5958,3557,3759,3804,3894,9807,8943,10
601,10946,10829,11584,10455,11026,4990,5911,7274,6394,6515,7318,5593,5749,14343,14465,12595,12589,9894,
9134,10050,9615,10887,10588,9652,9575,12705,13448,12501,13354,10659,10646,9188,9884,9833,10006,9163,96
69,10704,10920,9465,9704,9925,9082,9790,9566,3059,4008,3832,3918,6625,6718,7492,6557,12856,13408,13120,
12876,11041,11309,10602,11404,3710,3061,4033,3801,7253,6747,6510,7689,5606,5858,7431,7199,6612,7714,593
8,5471,8701,9998,10830,10649,13323,13825,12474,12934,6799,7044,6949,6759,3975,3576,3897,3930,11526,1081
0,10114,9841,12692,13379,12515,13184,7310,6828,5799,5105,2031,1983,3814,3559,11361,11028,11792,11346,91
41,9165,10837,11315,7553,6854,5562,5970,7331,6573,5051,5835,10812,11426,9589,9681,12882,12706,12590,129
37,6938,6396,7258,6517,6749,7376,6992,6834,5582,6026,6857,6776,5985,5100,5754,5917,10459,10551,10948,10
838,14402,14848,13059,12648,5814,6025,7460,6626,6950,7276,5695,5603,7227,6571,5872,5501,7321,7048,7713,
6558,12827,12399,13340,12619,11529,10841,9900,9819,4002,3767,3825,2943,5831,5927,7435,6367,7270,7698,55
89,5106,3487,3054,3926,3939,10891,10661,9192,9882,11032,11042,9084,9466,13456,12502,14347,14376,10851,1
1287,9630,10009,3987,3709,3550,4034,6807,6836,6979,7472,10842,11412,10650,10471,12597,13350,13572,1247
6,6080,5551,6763,6616,3900,3982,2046,2047,9582,9656,10928,10893,10060,9142,9343,9923,12737,1336
1,12505,
12696,9698,10019,9789,9055,11368,10488,11310,10609,12897,12884,12839,12938,9643,8951,10430,10604,10056 ,9906,11808,10894,11335,10899,9893,9587,12517,12447,12708,12598,5053,5961,7281,6599,3771,3820,3563,3945 ,13381,12829,14404,14466,11401,10575,10720,10555,6940,7333,7745,6953,6858,7392,6865,6981,9995,9200,1046
1,10610,11525,10853,9815,9674,13576,13061,12898,12945,11648,10662,9468,8702,6860,7230,5079,5806,7446,74
96,5054,5610,12621,13353,12407,13386,10665,10691,9627,9844,7008,6954,7317,6750,5972,5864,7338,7056,1288
8,12627,13472,12506,11317,10854,10783,11538,10475,10652,10583,10612,9171,9684,11425,11015,5817,6034,72
47,6866,6840,6521,5756,5596,5499,5988,7568,6579,5915,5837,5612,5083,3062,3518,3791,3979,7437,7704,6028,5
559,12656,12940,13319,12518,9145,10120,10021,9581,6961,7273,7936,6463,5108,5939,6765,7324,3065,4016,392
9,3942,3817,3565,3826,3989,12679,12601,12738,12830,10557,11779,9930,8955,10462,11339,10064,9166,13826,1
2622,14355,14349,5845,5095,6956,6628,7489,6574,7716,7282,14384,14350,13364,12521,10666,10693,9645,9835,
3871,3707,4040,3923,7443,6982,6811,7363,3803,3549,3066,3948,5934,5373,6632,7255,10477,11364,9905,10010,
12843,13062,12463,12411,3773,3039,3981,3887,6383,6522,6603,6766,7554,6771,5743,6021,6581,6524,5594,5838 ,9407,9594,10799,11410,9821,9712,10022,9883,11532,11073,9146,9651,13443,12946,14408,14593,12900,12629,1
3065,12508,12602,13393,12712,13356,7345,7752,6962,7322,5609,5976,5813,5112,9926,9071,11044,10952,11322,
11074,9173,9697,10901,11293,9898,9174,12683,12961,12871,12643,11048,11019,11457,10857,10844,11781,1067
3,10960,11056,11341,10116,9119,11416,11076,10025,9831,6049,5933,7438,6605,5963,5727,7687,6640,10587,111
37,11376,10483,9639,9938,11537,10902,6813,7334,5565,5843,7461,6823,4863,6000,9535,9871,11840,10694,1055
8,10915,10012,9953,13584,13382,12575,12471,12522,13339,14357,14468,5820,5620,7284,7223,3573,4003,4036,3
932,5085,5502,5850,5918,7365,6868,6985,7449,6773,7728,6495,6611,3774,3996,3828,3566,9671,9467,9187,9932,
12413,12845,13504,12948,7504,6582,7259,6881,6395,6606,6586,6585,12904,12630,14371,14594,11350,10858,95 93,10080,12604,13445,12529,13066,8957,9148,11321,11138,5931,5595,7810,6613,7693,6391,6827,7340,11021,11554,9688,10053,12851,13362,12633,12740,11460,10616,9079,9629,12685,12691,13400,12495,3068,3815,3953,3899,6040,5959,5986,5563,3941,3993,3805,3578,5099,5618,7370,6986,14362,14849,13828,12962,12846,13073,13388,12720,7556,7271,6882,7288,4006,3519,3055,4048,5859,5791,7452,7043,7746,6814,5946,5086,9177,9912,10668,11786,9189,9822,10005,9654,5101,6033,7462,6927,7229,6993,5818,5941,13327,12645,12475,13450,10905,10976,10807,11347,12524,12952,13600,12912,11432,11318,9590,9837,11080,10865,10478,11399,10599,10697,10639,11027,7699,7337,5591,5751,3895,3946,3571,3990,10040,9879,10831,10918,12875,13068,13368,13410,6964,7720,6872,7072,6935,6511,5861,6052,9439,9908,10674,10917,11530,11782,10128,9178,7520,7045,5583,5846,7377,6774,5965,5617,9675,9843,9937,9135,10589,11540,10051,9700,11342,10485,11428,10698,14416,14373,12993,12414,7465,6829,6988,7348,6777,6855,5055,5992,4009,3919,3819,3577,5359,6036,7262,6397,6835,7445,6968,7319,5866,5973,7046,6830,10026,9646,10906,11353,12530,13351,14361,14358,10860,11793,9083,10033,9190,9787,11403,11553,12853,12686,12634,12744,9470,8958,9657,9901,7812,7366,5605,5807,7560,7277,6884,7491,14472,14596,12646,12693,12591,12857,13832,12532,10603,10367,9956,9838,13446,13385,12883,13571,3960,3806,4037,3994,3574,3954,3931,3821,5852,5942,6994,6519,7702,6588,5107,6056,12477,12854,12964,13457,11307,10431,11365,11022,10647,10676,9929,8703,13342,13396,12649,12994,7450,6614,7311,6627,7691,6559,5880,5966,10866,11458,9677,9596,12877,13632,12503,13074,10811,10705,9885,10058,10921,10486,10947,11586,4005,3901,4024,3063,5758,5109,6629,7049,12935,12636,14600,14374,10144,9683,9180,9849,12707,12694,14850,14432,9944,9999,10590,11324,10839,10908,11788,11030,9591,10036,11405,11560,6081,5849,7346,6939,6617,7384,6778,6888,6023,5624,7760,6996,5945,5978,7104,7466,10700,11363,9193,9143,9846,10118,11440,10489,7009,6837,5862,5607,3799,4041 ,3551,4010,10922,11904,9899,9583,12752,12968,14403,14377,7275,7938,7494,6941,7369,7748,7715,7050,10813,11411,10651,11043,13089,13357,12650,13452,6050,5815,7396,6859,7285,7474,5873,4991,9194,9660,11356,11029,11544,10949,10605,10680,3829,3933,3956,4064,6951,6618,6780,7323,2015,2045,3902,3580,6838,6398,5535,5102,14480,14364,12878,12697,10028,9686,10065,9463,10868,10929,9886,9085,13574,12858,13409,13076,7694,7809,5974,5987,6861,7215,7459,6719,10614,11464,10115,9653,10663,11796,9940,9907,13840,13394,12885,13363,10706,11033,9167,10054,12860,13474,12507,12599,9086,10007,11370,10490,10611,11414,9689,9845,12996,12886 ,13577,12889,7057,7584,6942,6955,6523,7352,6035,5757,12939,12709,13080,13090,14405,14378,12899,13335,10721,10814,11588,10653,12890,13460,12698,12519,7497,7335,5598,6082,6841,7708,5948,6030,11349,10843,10606,11785,9702,9954,11527,11295,10708,11810,10034,9567,10895,11140,11045,10855,12976,12941,14852,14385,11406,10924,9895,9201,6575,7286,6751,7372,4020,3822,3067,3943,13416,12536,13358,12657,11649,10950,9658,10066,6633,7468,5819,5868,7010,6867,5611,5993,14410,14608,12478,12652,11427,10669,9147,9931,4035,4017,3830,3327,6630,7717,7325,7378,11034,10492,11354,10613,10845,11472,11088,10930,13856,12942,13383,12947,9678,10122,10953,10872,10081,9196,9850,10013,13449,12623,12768,12603,9910,10121,11556,10722,11046,11372,9791,9699,7052,7937,7705,6862,5110,5566,6957,7508,11323,10667,9968,9597,11417,11144,11809,10654,5839,6027,6620,7000,3991,3947,4042,3711,7261,7555,6983,7473,7439,7290,6869,6842,7616,7058,5113,6064,7393,6896,7012,6963,12509,12658,13573,12901,9927,10023,11531,10463,11366,11794,9685,9202,13696,12710,14496,15362,7493,6958,6583,7073,5977,5990,7341,7722,12713,12739,14856,14624,10903,10932,11075,11568,5865,5613,6634,7283,5874,6037,5919,5755,13365,12902,12831,13586,10176,9647,10859,10712,12523,12700,12631,12660,9149,10057,11377,10695,7824,6767,6088,5971,7776,7480,5851,5597,14864,14528,13473,13063,11036,11429,11841,11049,12605,13827,12510,13387,12714,12741,12525,13412,6815,7342,7506,6883,4012,3833,3069,3983,10954,11488,10961,11077,10956,11326,9175,9902,11542,11592,91

50,9706,12847,13458,14880,14406,5114,5996,7747,7701,582
1,5087,7557,7060,11104,11050,11413,10846,10068,9960,11434,11152,3934,4049,3455,3827,7447,6607,7380,6987,
13580,13121,13092,13000,9913,10130,11343,10962,10936,10617,9852,9692,13370,13122,12949,13341,14380,144
67,14417,14386,9595,10084,11664,10675,10011,9933,9708,9179,13096,13067,13505,12905,11533,11800,10124,9
655,11057,11369,12032,10559,9204,10035,10861,11420,12892,13829,12721,13008,4038,4018,3927,3070,7279,65
25,7816,7498,13104,13389,14409,14351,13464,13124,12635,13185,3950,3995,3807,3955,6641,7730,7074,6965,99
41,9191,11052,10724,11585,10670,11812,11378,13424,12531,13585,12950,11539,11078,10907,11459,6870,7105,7
347,7326,6029,5935,7016,7562,13888,12742,12606,12963,10030,9469,10728,11351,6636,7394,7476,6775,5621,60
51,6084,5980,14656,14469,13398,12906,10479,10618,10699,10862,11650,10867,9839,10117,10677,10620,9690,9
934,5822,6044,7718,7367,6873,7289,7749,6844,5876,5614,7940,6587,5116,5863,6001,5947,13369,13186,13069,1
3602,11441,11848,11058,11418,7451,6885,5989,6041,7522,7706,7500,7349,6989,7463,7064,6526,3575,4044,3834
14007,13508,12664,12716,13834,14388,14359,12953,13024,7729,6966,7569,6995,7373,6874,7753,6642,9705,1007
2,9909,9208,12855,13395,14470,14720,13480,13366,14412,14473,10145,10029,11534,10701,4050,3961,3997,406
5,5853,5626,7024,7400,10059,9823,11783,10736,13128,12913,12526,13447,6886,6589,7536,6615,3582,3836,3958 ,4013,10909,11430,9661,9939,11557,10919,8959,10096,12647,12745,12687,13075,9916,9716,11380,11319,14418,
14392,12879,12966,12722,12965,13578,13830,14363,14433,12637,13588,9181,9598,9946,10014,11461,10964,110
81,11545,13390,12533,13476,12746,6054,5567,5103,6096,6779,7292,7840,7076,10869,11824,10591,10707,12954,
13401,12908,13841,11600,10678,11355,10977,10491,10702,10682,10681,10027,9691,11906,10709,11789,10487,1
0923,11436,13451,13601,12651,12415,10136,10055,10082,9659,7724,6831,5943,5994,7354,7564,7756,7469,9195,
9714,11466,11082,11652,11367,10978,11384,5619,6038,7944,7047,7278,6969,6057,5967,13355,12479,13413,130
70,12695,12724,14375,14595,9955,9887,11548,11139,12914,13506,14420,14474,7379,7505,5867,5625,6644,7721,
6990,7814,7339,6889,6008,5854,4052,3949,4014,3823,6970,6876,6085,6042,7408,6590,7106,7570,12859,12753,1
4481,14597,11842,10910,10042,9182,7764,7080,7521,6619,5622,6002,6997,7454,12969,12534,12995,13634,9197,
10129,11558,11023,11325,11089,9914,10037,14365,14379,14434,14851,7011,6781,7695,7374,5979,5869,7558,70
51,12638,13372,12887,12956,11795,11433,9687,9847,4056,3579,4019,3998,7350,7811,7732,7477,6631,7952,6053 ,5949,6839,7585,7231,6890,13836,13078,14424,14476,13453,13608,12748,13411,3957,4039,4066,3775,6072,5111 ,6972,6897,7754,6998,7381,7470,5847,6089,5599,6058,13488,12537,12970,13952,11060,11816,10968,11168,1103
1,10607,9957,10148,12861,13459,12699,13091,11616,11141,9679,9942,13404,13077,13592,12997,11473,10870,1
0061,9713,11561,10925,11084,11444,12653,12728,12916,12977,10873,10951,9151,10088,14366,14482,12662,135
12,9455,10132,11358,10493,10931,11541,11064,11415,9962,10069,11142,10926,11908,11462,9701,9903,11656,11
373,10980,11587,7001,7512,7353,6648,6943,7499,6399,7108,15364,14407,12711,13844,9948,10038,11090,10615,
12754,13081,14598,14601,11798,10684,9203,10152,11546,10710,11407,10723,14497,14912,13418,12538,5877,59
81,7386,7053,6004,6112,7817,7703,7453,6863,7287,6621,7761,7059,7592,7524,3964,3903,4022,4043,6782,6892,5
950,5628,12659,13462,14381,14436,11787,10655,9976,10062,12769,12862,13636,12701,13397,12891,12654,1383
3,9854,9205,10725,11145,13575,13343,12756,13858,7088,7872,7475,7371,7013,7736,7572,6635,12943,13188,130
93,12903,10177,9945,11442,11035,13454,12972,13697,12998,10713,11480,10874,10984,6843,7397,6068,5870,40
68,4025,3835,3962,4053,3935,3071,4011,7495,6898,5115,5991,14976,15361,13475,12717,10119,9720,11856,1109
2,14387,14484,13082,12540,10041,10074,11200,11562,7327,7709,7002,7762,7561,7620,6622,7112,13402,12661,1
2893,13520,13136,12978,14382,14411,7404,6527,6083,6065,7356,7054,7945,6959,11105,10933,9958,9703,13001,
12920,14602,14609,11371,12034,11590,11037,11465,11844,11811,11146,10146,9911,11492,10955,11381,11570,99 69,9087,7723,7120,5878,5375,7014,7828,7777,7061,
13604,12770,13094,13420,11047,10714,10876,11419
,6039,59
95,7481,7385,6090,5759,7750,7968,14853,14440,133
71,12715,10934,10494,9631,9198,6871,7294,7586,66
37,7501 ,7395,6060,5881,13465,13192,13857,12702,
11790,11905,10070,10083,10957,11311,11555,10815
,14498,14389,13
579,12511,11153,11680,11038,11051,10619,11448,1
0131,9853,4046,3831,4072,4028,7820,7017,5117,603
1,7528,6 845,7710,7075,7467,7942,7509,7617,13414,
13842,12951, 12980,11593, 11431,9694, 10178,10937,
11804,10044, 101
26,13123,13616,12907,12760,10671,11382,10847,11
468,14529,15368,13425,12743,6900,7478,7004,6643,
6875,77
92,7382,6967,10729,11564,9915,9964,11106,10963,9
707,10089,14488,14413,13084,13477,13889,13097,1
3002,13
536,7719,7066,7343,7818,5982,6097,7018,7576,1300
9,13125,13004,13374,14500,15104,13590,13640,107
26,1181
3,11421,11474,13152,13098,13461,12894,7565,7062,
5503,5875,6086,6066,7780,7398,11148,12033,11801,
10958,9
206,9662,11053,11604,13482,13200,13391,13010,99
35,10123,10716,11096,3951,4021,4051,3837,6646,79
39,5975,
5118,12984,12665,14604,14610,11357,11651,11079,
11569,13712,12723,14854,14390,11535,11386,10965
,10938,1
3581,13848,13105,13417,11712,11154,9209,10160,7
077,7510,5998,6043,7482,7826,7731,7355,7632,6887
,7502,69
04,4045,4080,4026,3965,11489,10992,11108,11059,1
1589,11054,10679,11169,7388,7725,7025,7291,6638,
7523,74
16,6846,14080,12607,12909,13468,10073,10086,114
37,11818,9961,9709,10730,11379,14419,14393,1485
7,14448,
9970,10133,10015,9851,11920,10863,10184,10067,7
065,7768,6645,7020,5855,6003,7559,6991,13100,127
72,1363
3,12718,11872,11576,9947,9693,8000,7588,7136,784
1,5623,6092,5882,6055,10911,11438,11602,10979,13
860,134
26,15360,14471,9210,10092,11843,11797,9917,9183,
11653,11156,6591,7751,7580,7513,6098,6009,7401,7
848,135
87,13126,12955,13507,14414,14625,12776,13399,12
527,12666,12747,12910,11543,10703,11476,11083,1
3698,129
15,14530,14421,12725,12668,13489,13896,13106,13
466,14612,14858,11375,10621,11912,11594,6045,61
13,6877,
7941,5630,5884,7813,7484,13582,12749,13831,1278
4,10737,11826,11170,11061,12957,13478,13605,129
67,14394 ,14504,13428,13367,7375,6971,7734,7078,
4058,3567,4067,4054,10966,11201,11443,11422,101
25,10031,11112,11
658,10732,11490,11572,10871,14475,14435,13509,1
3012,9717,10147,10180,10076,9918,10140,11814,11
463,7778 ,7618,7026,7081,3999,3959,4069,4057,131
29,13593,12917,13872,14422,14396,12639,12755,71
07,7563,6891,7409 ,7263,6649,7525,6999,10969,113
85,11845,10940,14616,14425,13648,12726,13403,13
025,14626,14865,9972,9710,
12036,10683,9212,9959,10097,10043,12539,12750,1
2730,12729,11547,10981,10085,10137,11618,11802,
11596,11
445,11085,11559,11160,10622,14860,14532,13954,1
2757,7068,7954,6006,6061,6878,6973,7707,7357,138
37,1253
5,12971,13484,14477,15376,14437,14483,7755,7507,
6100,5997,7574,7402,7832,7530,11825,11062,11665,
11091,1
3514,13130,13700,13415,7109,7758,7874,7383,6062,
5871,7082,7028,11469,10970,11849,10738,13026,13
432,145
12,14478,9949,9722,11120,11496,13596,13187,1389
0,12958,10982,10685,11632,10711,13606,13071,133
73,13137 ,6104,5627,6650,7471,7733,7948,6067,604
6,10150,9663,9199,10192,10875,11388,11936,11172,
6893,7514,7784,7
089,7110,7600,7825,6899,11820,10927,10039,10090,
13843,13481,13108,13864,13016,13216,13079,12655
,14866,
14657,13664,13189,11450,11660,11852,11565,14367
,14536,14426,15392,13521,12918,14881,14628,9715,
10134,1
2040,11143,3838,4074,4023,4060,7410,7003,6005,60
87,11374,11065,10153,10063,13609,12973,13132,13
492,757
1,7737,7532,7084,7358,6974,7953,7055,11475,11601
,9963,9721,10740,11817,11086,11910,12921,12999,1
4658,14
868,14599,14485,14438,14441,11435,10985,10104,9
950,13406,12541,12979,13589,13112,13463,14640,1
4632,131
90,12974,13956,13510,11066,10972,10181,10138,11
504,10686,11202,11666,13704,13421,13028,13635,1
1860,111
76,11617,10715,4015,3963,4073,4070,7765,7726,797
6,7015,13138,12663,13846,12732,9718,10098,11093,
11550,1
1107,10877,11791,11470,10075,9965,11654,11147,1
3594,12758,13455,12771,11446,11907,11828,11573,
10727,12
048,10149,10045,10935,11681,11327,10986,6114,58
23,6783,7624,7842,7479,7032,7516,13835,12703,153
66,1449
9,12773,13193,14428,15369,7389,6623,7566,7412,60
12,5951,6070,6091,10168,9207,11068,10993,13490,1
3083,12
761,13528,7090,7876,7821,6894,7946,7770,7537,711
3,6116,6073,6652,7757,7005,7590,8001,7483,14383,14603,1 2922,13032,11850,11094,11477,11566,6901,7526,71 14,7844,7387,7063,5883,6010,14721,14882,13904,13 140,146 60,14544,14722,14486,7738,7577,7970,7648,7019,77 79,7403,7006,9943,10185,9695,10154,13248,13610,1 4489,14 501,13153,12981,14442,14391,11097,11608,11449,1 0744,4029,3966,4081,4047,6101,5983,8064,7819,134 19,1408 2,13638,13085,13513,13892,13859,13194,5119,6059, 7589,6902,4076,3581,4059,4030,14664,15424,13540, 13003,1 1039,11595,10495,11204,13429,13618,13095,12762, 9973,10077, 11482, 11149,12924,13467,12982,12542,10 100, 10 208,11913,11799,13838,13953,14872,14913,11549,1 0959,11383,10717,13005,13359,14884,15370,13603, 12863,13 201,13728,11857,11155,11688,11620,13086,13099,1 2667,13496,10878,10988,10046,9724,11184,11968,1 1571,114 67,11109,11832,11668,10731,10939,11493,10164,99 66,14449,14490,13641,13479,14415,14605,12985,13 852,7293 ,7092,7503,7960,7740,7815,7856,7121,115 91,10994,9211,10087,12719,13430,12895,13516,114 23,11805,11098,11 858,14444,14914,12777,13612,14560,14502,13154,1 3011,11657,11716,10718,11208,7529,7067,7766,711 6,7578,7 455,6094,5879,7873,6905,7540,7021,6120,6076,7351 ,7619,7593,7956,7096,7830,6639,7406,5999,6069,14 855,148 88,12774,13861,13469,13522,13196,14081,11500,10 623,10179,10161,13849,13006,13101,13652,14531,1 4606,127 64,13144,11452,11150,12041,11055,7788,7763,7485, 7573,7969,6847,7515,7782,15377,14977,13405,1369 9,11819, 11216,9974,9471,4082,4027,4071,4061,7711,7880,70 79,7829,7122,7769,7027,6906,7390,6647,7602,7069, 13127,1 3617,13583,13434,11110,11924,11873,11157,7538,7 413,6099,5885,7022,7622,6879,7943,15372,14859,13 013,1298 6,13760,13202,14611,14916,13537,13040,13156,131 07,13637,13102,12727,13217,10135,10091,11577,11 481,1462 7,14395,13485,13866,10186,9855,11846,12064,1096 7,11390,11682,10733,12778,13427,14505,14896,115 97,11491 ,10156,9977,13968,12911,14450,14613,119 16,11113,9213,10127,13920,13624,12959,13486,116 24,10941,11806,11 171,13650,13027,14492,14423,11563,12038,11605,1 1713,6093,6128,7822,8004,6074,6013,7587,7781,109 96,1157 4,11100,10739,13891,13845,15488,14533,10971,118 88,11478,11063,11815,11162,11439,11914,14452,14

506,1370 1,13204,10078,10193,11114,11672,6106,5615,7625,7 517,7843,7399,7137,7735,4084,4055,4078,4062,7972 ,7596,7 029,7083,11661,11158,9599,9971,13591,12751,1352 4,13131,14397,15378,13423,12669,10182,10162,118 76,11494 ,13960,13642,14867,14861,10742,12035,10 071,9214,7138,7544,7888,7800,7124,7833,7070,6908 ,12785,13874,132 18,13109,14978,14617,13014,13249,13491,13470,14 614,14862,13160,13706,12780,13538,7414,7085,777 2,7511,7 949,7601,6115,6102,13620,12919,14513,14629,1117 3,11606,10094,10139,14724,15393,13862,13511,115 78,11922, 11827,11451,8065,7727,7531,7786,6047,6007,7111,7 411,13017,13433,13893,12988,14427,14920,14084,1 2731,76 28,7594,6117,6105,7030,6975,7827,7486,11728,1098 3,11598,11000,15105,14534,13595,13029,11484,118 21,11121 ,11387,14508,14456,13666,13850,13644,13 493,13133,13607,10734,11619,11512,10942,7955,70 91,7849,7575,665 1,7405,7984,7033,11161,11864,10741,11116,9951,10 099,11655,11087,7794,7128,7904,7634,7759,6895,58 86,6122, 14537,14672,13208,12670,12096,11684,11232,11937 ,9719,10188,9978,10151,14398,14618,13873,13110,1 3713,13 139,14479,15365,10687,11847,11676,11609,15380,1 4439,13517,13018,10194,10105,11497,11944,7846,7 086,8002 ,7567,7604,7527,7140,7836,10141,10209,1 0973,12037,13897,12786,14514,14630,9726,9980,11 909,11580,11471,1 1067,11830,11174,13168,13544,13030,12733,13680, 12759,14429,15394,7785,7958,7115,7621,6071,6108, 7417,76 56,14980,14538,14928,14659,11874,11714,11122,11 177,12923,13436,13984,13220,13868,12975,14728,1 4633,134 98,13708,13900,13613,14088,13191,13422,13113,11 203,11659,10987,11505,13523,13649,12788,13865,7 877,7034 ,7742,7518,6063,6011,6653,7950,11359,10 745,11621,11095,13134,13958,13483,13033,15106,1 4443,14516,15616, 11164,12050,10102,10157,8066,7793,7093,7117,408 8,3583,4075,4077,10974,11069,11803,11453,11851,1 1603,101 96,10093,13114,13020,14487,14545,11670,11498,11 928,11626,14620,15363,13552,12734,14984,14430,1 3250,137 14,7541,7633,7852,7771,7144,7834,7036,7418,7582, 7961,7534,7608,6121,6118,8012,7094,11205,11854,1 1970,11 479,13908,13224,14540,14634,13665,12763,14736,1 4944,10158,9967,11178,11124,10200,9723,10746,11 567,1542 5,14688,14661,14869,11829,12044,10163,10142,109

89,11610,11880,11185,7295,7875,7650,7971,7741,7007,6077,
6014,13141,13598,13155,12925,11206,11696,11921,10995,6129,6095,7595,6903,8008,7858,7845,7539,14491,145
46,13839,13518,14641,14883,13702,13195,13494,13955,13876,13621,11506,11099,10101,10183,12775,14096,146
36,14445,11667,11833,11628,11180,12983,13729,13375,13034,11454,11070,12049,11151,13116,13041,13898,131
42,13525,13614,15384,14520,11861,11822,12072,11111,10210,9919,10879,11720,7947,7152,7767,7626,7420,6654 ,7579,7796,11938,11575,11128,11612,13145,13656,14870,15396,13497,12792,13087,13643,14873,14451,12543,1
3252,11485,10719,11662,11508,15426,14503,14561,14662,13530,13197,14642,15108,10108,10047,10166,10187,1
1186,11972,11917,10990,14493,14992,13961,13847,7123,7636,7097,8072,7973,7533,7882,6907,13597,13007,146
65,14446,12042,11866,11633,11209,4083,4085,3839,4086,6124,5629,8016,7118,13431,12765,14453,14548,13905,
13203,13736,13668,10212,10169,10748,11853,14507,15374,12926,13036,15112,15400,13232,14016,13619,13515,
13157,13880,11101,11686,12097,11579,10997,11622,11210,11940,13716,12779,12987,13541,11483,11159,9979,1
0106,7597,7787,7857,7962,7359,7546,7773,7664,13639,13042,14666,15489,11834,11673,12066,11744,13471,138
53,14562,14885,11115,11875,11499,11102,13146,13906,13705,13764,10197,10079,12160,11915,7974,7835,7098,7
603,7878,7023,7125,7649,9215,10155,11685,10998,15379,14874,12766,13256,13548,12671,14723,14644,11389,1
1188,11599,12056,6107,6078,7850,7126,8068,7071,7977,7783,13500,13198,14089,13103,14552,14752,13867,132
64,7591,7890,6130,6075,7487,7823,7964,7905,14607,14615,13158,13972,13921,13205,14494,14673,11836,11911,
11952,11217,14886,15008,15428,14454,13625,13529,14668,14915,11625,11163,11862,11212,13894,14112,13015,
13438,13730,12781,13645,13539,7623,7419,7139,7884,7545,8032,6909,7100,14876,15408,13964,13161,11674,11
551,10190,9975,4089,3967,4090,4087,7640,8005,7031,7581,14725,14509,13672,12989,11969,11001,11636,11117,
15373,14457,13854,13219,10216,10172,11447,11715,13611,14086,13653,13761,14889,14535,13044,13622,13148,
12787,15120,14515,13019,13936,13526,13111,11689,12052,11192,11926,13863,13210,13487,13962,10735,11502,
10095,10165,11884,11859,11581,11669,12065,10943,11611,11878,14564,14674,13162,13720,13709,13206,14648,
15872,11807,11976,11175,11925,15040,15490,13924,13542,11218,11865,11123,11002,14726,14510,12790,14083,
14890,14917,13221,13654,7129,7864,7141,7774,7957,7606,6119,6109,11486,10743,11698,11165,15382,14729,13
626,13970,14619,14458,14784,14689,11634,11509,10195,9981,7542,7789,6132,6103,7992,7831,7391,7860,8080,7
130,7627,7795,7889,7087,8003,7652,13875,13499,13776,13031,13646,13048,14897,15432,11118,11718,10975,12
039,13532,13869,13169,13435,7978,7598,7035,7985,4092,4091,4079,4031,10189,10224,11918,12100,14539,1439
9,12782,13667,7142,7739,7422,6910,7609,7853,7908,7790,13560,12990,14676,14730,15385,15617,13209,13912,1
2789,13164,14863,14918,13703,13135,14144,13732,13280,13985,14892,14517,10170,10109,11683,11877,14631,1
5395,14621,14568,10202,9711,11721,11613,12735,13895,13724,13657,14460,14541,13545,13992,11939,11495,11
233,11831,14518,14979,13021,14085,12068,11692,11125,11179,15492,14898,13957,13628,13519,13115,13878,13
222,11234,11640,11984,11896,11220,11929,11166,11004,14622,14921,13922,13762,11510,11181,11868,11607,120
45,11697,10211,10198,6126,6110,7881,6655,7629,7548,7837,8010,14635,14690,15381,14547,12161,11823,11627,
11882,13170,13225,14737,15440,14521,15397,13251,13707,10143,10103,11207,11507,13035,13553,14732,14680,
6136,5631,8096,7635,7132,7801,7896,7951,7543,7988,7145,7095,7798,8070,7851,7535,11724,11690,10213,10201 ,13407,12793,13669,13143,14922,14981,13212,14098,15618,14929,14871,14576,7146,7612,7980,7638,8017,7415,
7838,7037,15386,14542,13022,13117,13851,13501,14431,14663,8067,7605,7892,7859,6123,6125,7119,8006,1112
6,11071,11923,11582,13899,13651,14900,15136,7038,7959,6131,6133,7641,7797,7654,7906,13718,13546,13976,1
3674,13253,13902,14018,13527,14738,14692,13226,13172,12051,11187,11945,11671,12794,13615,13877,14092,1
0747,11501,12080,11129,14643,14637,14753,15496,13037,13658,14549,15402,11890,11224,12000,11730

,11855,10991,9982,10218,11942,11182,12098,11663,14904,15456,13928,13233,11700,11623,11236,11932,15168,14924,13254,13744,13969,13043,15371,15873,11881,12054,11211,11717,14522,14982,13554,13147,10167,10204,11513,11752,11973,11130,11838,11614,14740,15427,14563,15232,7986,7519,7847,7153,7610,8018,7099,7883,10159,10107,10749,12046,12162,11889,11189,11213,14930,14754,13715,13881,13676,13228,14638,14985,13502,13118,15107,14696,14097,13199,13909,13870,7630,8074,8033,7148,7802,7965,7862,8073,14875,14447,14120,13159,15388,14667,12927,13768,13986,13623,13176,13660,13533,12767,13710,13556,11637,11729,11948,11867,15504,14550,13234,14020,14645,15398,13965,13038,14090,13914,15620,14524,5887,6134,7743,7651,7920,7549,7879,7975,11240,11930,11132,11514,11678,12057,11630,11704,7637,7154,8128,7599,7101,8009,7127,7854,10217,10214,12108,11190,14785,15409,13681,13257,14553,14744,14945,14932,12796,13901,14887,14986,7102,7658,8020,7912,6137 ,6015,7865,8082,11391,11971,11746,12067,14565,14495,13149,13734,14756,14646,14145,13627,11837,11103,10173,10110,10225,10191,11691,10999,15429,14877,13045,13670,15624,15109,13258,13988,12104,11954,11941,11635,14946,14993,14669,15401,12043,11248,11863,11722,7804,7644,7547,8036,7963,7885,7660,7131,13531,13207,14455,15434,13882,13721,14114,13792,13163,13923,13547,13150,11516,10750,11675,11892,14936,14675,14208,13963,11219,11732,11193,12168,15520,14554,13733,13046,12069,11629,11978,11003,14704,14988,13437,13236,13647,14104,15367,14566,13884,13959,14000,13265,10220,9725,12112,11214,8076,7607,7156,7987,7893,7143,7982,7421,11693,11883,11953,12058,14727,14649,13673,13211,13910,13260,14786,14878,13722,13599,15874,14670,11455,11642,11869,11760,14017,13049,13684,13165,15412,14569,14891,15110,12070,11931,11194,11699,14511,14459,15491,14994,13495,13763,14948,14677,7791,8069,7642,7886,7657,8024,7861,7160,8097,7981,8011,7775,7613,7891,6911,8048,11974,11119,11221,11745,13737,14100,13240,13974,15113,14556,12783,13550,10203,10174,11946,11222,14650,15441,13932,13907,14760,15404,13629,13717,14731,15009,14113,12991,12164,11167,12073,11879,7868,7668,7133,7550,7898,7966,6138,6135,11687,11986,10226,10171,13659,13926,13855,14024,11583,11919,12060,12001,14919,14691,13223,13973,13266,13913,15632,15430,13171,13050,13534,12791,11719,11515,11235,11980,14623,14519,13746,13213,11641,12128,11005,11196,13682,13557,14570,15387,13166,13766,13023,14087,11736,12101,11127,11677,7979,7643,8088,8007,8034,7611,7147,7666,14461,14893,15552,14996,14952,14678,13966,14148,14652,15493,14577,15114,14899,15410,13731,13925,11225,11960,11237,11870,14681,14788,13769,13661,14733,14739,15448,14543,12053,11702,10215,10205,7907,7839,7994,7134,7149,8081,7866,7989,13987,13543,13281,13879,14116,13740,15876,15010,4094,4095,4063,4093,7639,7799,7909,8100,13173,13227,13282,13688,11638,11885,10228,10199,14894,15121,15436,14768,12088,11927,11487,11956,14032,13944,15375,14693,14523,15498,13268,13977,13214,13052,14572,15000,13558,13229,13916,13655,14093,13745,15648,14960,12176,11226,11723,11891,14923,15116,15416,15458,11985,11183,12099,11748,14209,13871,15041,14462,12074,11694,11131,12081,13675,13930,14578,15399,13255,13555,14901,14734,7631,7894,8013,7665,6140,6139,7103,8040,13772,13738,14682,14792,11238,11835,11518,11006,13174,13119,13971,13630,11705,11949,12004,11886,7407,8084,7914,8021,7653,7855,7900,7990,14099,13235,14694,14741,14639,14905,15880,14580,13993,13719,15494,15433,14931,15619,12795,13549,10222,10206,11977,10751,14128,13177,14525,14902,11725,11644,11933,12106,13938,13272,14048,13778,7155,8104,7928,8014,7806,7157,8129,7897,15012,15505,15390,15444,13903,13039,14697,15042,14925,15680,14551,15122,13990,13230,14146,13711,14983,14684,13748,13671,10232,9727,12192,11731,14755,14742,13284,13980,13929,14102,13259,13765,14800,15016,13561,13800,14021,13178,13886,13662,11228,11897,11992,12047,15137,15405,14698,15500,11639,12084,11241,11191,12797,14094,14926,14745,11894,12166,11947,11631,11242,11708,12076,11734,15622,14906,14210,13937,12113,11511,11934,11133,15457,15124,15888,15
442,12163,11701,11988,11955,13237,13261,14933,15411,14908,15522,13685,13777,8071,7672,7993,8026,6127,6
079,7910,7655,10219,10221,11215,12102,14555,14647,15044,14934,11134,12055,10227,10229,15625,14937,1399
6,13915,8098,7863,7921,7039,7583,7150,8022,8035,14987,14757,13288,13978,15128,15138,13180,13562,8083,78
05,7646,8130,7996,8078,6142,6143,14947,15383,13726,14105,14938,15508,14746,14567,7867,7916,7659,8041,71
58,7614,7887,8075,13678,13752,15024,14989,14156,13238,13439,14019,13794,14115,13885,13151,15464,14584,
15406,14705,11737,11893,11750,12002,13739,13047,14526,14700,14152,14002,15904,14990,15431,14995,13989,
13683,12082,11615,11943,11249,11706,12114,11195,11979,11726,12170,12129,11244,15497,14671,14816,14651,
14091,13296,14557,14706,15621,14949,13911,13770,11898,12061,11958,12169,15744,14758,13564,12798,9983,1
0230,11839,11747,12016,11645,11975,12071,14761,14787,13723,13940,11733,11250,12224,11695,15413,14950,1
4879,15634,14571,14748,14679,14708,13267,13780,15521,15111,13241,14216,14117,13677,7161,8112,8025,8038 ,7913,7661,7922,8085,14653,15875,14026,13051,14558,15435,14160,13262,14762,14789,13741,13931,14573,154
60,14001,14106,7967,7803,8136,8019,7899,7645,7162,8044,11197,12105,11223,11950,13503,13690,14895,15506,
13917,13808,14118,13979,15628,15169,13242,13747,7869,7135,8077,7983,7669,8099,8132,8028,11198,11754,12
116,12008,10233,10111,11961,12178,14022,13167,15140,15048,15418,15170,13269,13793,14997,15389,13994,13
270,11900,11740,11643,12132,15144,15115,15553,14953,14940,15877,14769,15056,12059,11981,11756,11227,15
152,15437,14212,13215,15512,15172,14121,13927,12172,11703,11252,12083,14683,15233,15472,14579,11989,11
239,12078,11517,13735,14034,15633,14998,13631,13967,15936,14790,14654,15011,14108,14049,11887,12165,11
738,11982,7870,8092,7924,7662,7164,7911,8049,7995,13767,13563,13283,14028,11753,12120,11957,11256,1544
6,14954,13689,14176,13053,13244,15417,15234,15117,15650,13784,14149,15556,14712,13175,13725,12193,1207
7,12107,11871,13273,14008,14764,15882,13285,139
18,14101,13750,15001,15072,14903,15443,11709,11987,1100
7,12144,15528,15414,13686,13933,8037,8089,7901,7674,8102,7615,7151,8144,15176,14961,14574,15495,14695,1
4793,14735,15123,14136,13975,14927,15014,11964,11764,11229,11646,13535,14004,14770,15013,15626,15878,1
4224,13274,7991,8042,7667,8086,8105,8015,7915,7673,11994,12062,10234,10231,13771,13939,14033,13231,146
85,15636,14147,13796,15438,14581,15524,14794,12075,11739,12184,12103,12130,11707,11243,11762,14122,137
42,15002,15449,14956,15889,13179,14129,13286,13883,15499,15649,13566,13054,13753,13997,12003,11935,120
90,11230,14699,14463,14052,13934,11245,12177,11962,12085,15403,14527,15461,15118,14743,14772,14025,127
99,14962,15554,13773,13692,14907,14801,13981,14154,15017,14582,15043,15682,8056,7902,8133,8090,7670,80
50,8027,7917,14240,13779,13276,13945,11735,11895,12005,12196,14040,14095,14686,15420,14935,15004,15884 ,15126,13687,14132,15501,15656,14796,15459,13289,13239,13942,14214,15536,14585,11727,11990,12109,11761 ,8101,7997,8120,7159,7895,8137,7647,8106,7925,8029,8052,8160,6111,6141,7998,7676,15018,16000,13995,1367
9,10236,10235,11199,12136,14909,15507,14747,15139,13290,13756,15452,15125,15640,15045,14701,14776,1412
4,13782,14161,13559,14964,15025,13982,13181,11503,12180,12010,12117,14710,15560,14211,13749,14759,1589
2,14036,14003,14802,15129,13263,14150,11749,11951,11996,12086,13182,14103,15466,14586,14707,15510,1378
5,13941,11251,12200,12024,12110,14817,14910,15684,14749,11902,11253,12225,11993,15445,14939,14702,1588
1,13798,14050,15623,15391,14804,15906,14130,13663,14991,15236,15141,14951,12167,11768,12089,12122,8116 ,7918,7163,8039,8131,8113,7926,7423,15502,15020,13991,13297,10223,10175,12006,11751,15745,15046,13754,1
4162,15523,14765,13243,14027,15130,14588,15450,14709,14941,15568,15184,15026,13774,14218,15049,14968,1
4177,13292,13946,14109,14006,14217,15652,14818,15142,15468,13887,13795,15419,14763,14064,13693,15513,1
5240,15905,14750,12194,11959,12017,11135,14023,14119,15627,14559,15462,15890,13781,13298,11679,11246,1
2118,12131,12179,11901,11742,12226,14999,15028,15171,15664,8087,8043,8138,7807,8108,7929,7165,8

079,142
72,13743,14955,14808,12092,12174,10238,10239,13 245,14153,15473,14791,11963,12012,11755,12137,1 5132,155
25,15937,15145,15050,15584,15057,15173,15052,15 422,13271,13998,15638,15688,13246,13802,8030,81 45,7551,
7923,8134,8114,8023,7166,15200,15146,15509,1494 2,14164,14056,15530,15248,14009,14226,15439,150 58,15032 ,14713,13948,13788,13691,14180,15760,14 771,14107,14029,13804,13275,11254,11710,11983,1 2171,15629,15896 ,14220,13751,15153,15465,16128, 14655,13300,14131,14957,15516,11257,12208,12121 ,12134,12009,11757,12018 ,12181,14037,13287,1514 8,14820,15681,14766,15908,15474,12063,11899,122 32,12115,15635,15174,15003,15555 ,11995,11741,11 258,12140,14126,13565,14824,15447,11965,11231,1 2173,12079,14575,14714,14795,14958,15746 ,14963, 13935,14213,14773,14716,13786,14030,8046,8091,7 903,8051,7671,8140,7930,8103,15537,15944,15154,1 5
514,13801,14168,14005,13304,8146,8057,8093,8161, 7678,7932,8054,8109,14241,14125,15630,14797,141 55,1391
9,15879,14832,15005,15526,13757,14035,15653,150 15,13055,14192,14012,13812,15476,15415,11765,12 195,1222
8,12124,13277,13694,14042,14110,15557,15060,151 77,15641,14965,15920,14687,14803,11966,12188,12 020,1175
8,15696,14774,15451,15073,14587,14798,14778,147 77,14123,13787,16002,14805,15885,14583,15019,15 532,1126
0,12007,12145,12091,14232,14151,14178,13755,121 33,12185,11997,11770,13291,13810,15562,15178,15 748,1546
3,15074,15480,12198,11711,11247,12240,14051,139 83,15644,15235,15938,15006,14138,13278,13293,14 225,1565
4,15119,15421,15185,14010,14133,8148,8045,8110,7 919,8152,7675,8115,8094,15891,15529,13783,13943, 12087,1
2138,11763,12182,15156,15912,15064,15264,15127, 14703,14053,14244,15712,15237,13775,14038,15569 ,14966,1
4157,13809,8053,8135,8162,7871,8060,7999,8118,81 39,15657,15021,15180,15540,14969,15047,13247,14 184,122
01,12111,12011,11769,13551,14228,15454,14589,15 027,15637,15160,15511,14058,14165,15238,15022,1 6004,155
58,13797,13999,15752,15469,15076,15683,12152,11 998,12229,12186,11766,12146,12123,12013,14044,1 4134,151
86,14711,15894,14780,13299,14248,15642,14806,15 503,14819,15883,14751,14072,14158,12197,12093,1 2216,112
55,13950,13301,14821,15241,14273,14041,15538,15
131,14809,15576,14970,15080,14215,13816,15952,1 5188,141
37,14170,15296,15658,15201,15029,14054,13799,11 991,12233,11743,12202,15467,16130,15686,15133,1 5561,159
40,15907,15242,14242,14007,15588,15051,15477,15 666,14065,13183,8164,8121,7931,8058,8149,8031,71 67,8107,
12021,12125,12148,12256,15143,14810,14972,15515 ,10207,10237,12094,11772,15030,14590,13727,1329 4,8142,7
927,8168,8124,8047,8117,8147,7933,15886,16001,14 166,14179,15053,15407,15651,14911,15249,15776,1 5134,15
147,14715,15544,14227,13949,15689,15527,13790,1 4274,15033,15900,14140,14222,14767,15478,14943, 15564,12
212,12014,11259,12135,14825,15660,14011,14060,1 5202,15059,13803,14185,12227,12209,12022,11519, 14822,15
909,15517,15570,15244,16129,15897,15054,13302,1 3758,15149,15700,14031,14219,14812,15192,12183, 12139,12
234,11903,15453,15747,15175,15665,15631,15482,1 5061,15034,15808,15250,13305,14256,15585,15088, 15204,15
155,8141,8176,8122,8061,8154,7663,8163,8150,1568 5,15150,14775,15265,14169,14182,15533,15914,140 57,1380
5,14826,15475,14066,14229,14111,13947,16016,149 59,14280,14163,15968,15672,14043,13789,15007,15 534,1569
8,15075,12204,12025,11261,12175,13306,14188,159 39,15893,14013,13279,15749,15252,12126,12241,11 647,1201
9,15639,14799,15572,15179,12230,12210,12119,112 62,15471,14717,16008,15690,12142,12187,11999,12 147,1483
3,15922,15266,15157,15062,15297,15539,15518,142 21,14127,15208,15754,8095,8055,8165,8153,7934,81 70,8119,
8156,14828,15586,15668,14967,13813,14243,14276, 14172,14014,14236,15910,15559,15065,15481,15941 ,15036,1
4068,13806,16132,14779,13308,14055,14193,14139, 15643,15077,14181,14233,15714,15898,15692,15541 ,15181,1
5655,15256,14718,11767,12236,12026,12199,15921, 15158,15761,15187,15565,15066,15945,14834,12242 ,12153,1
2189,12257,14045,13818,15216,15592,15078,14781, 15728,14807,11774,12028,12150,12205,14246,13759 ,13295,1
4288,14971,15484,16032,15268,15916,15023,14135, 14186,15546,15756,15948,15661,13811,14230,16136 ,15239,1
5470,15161,14249,14159,15571,15697,14059,13817, 14836,15913,15182,16006,15531,15081,14200,14046,12244,1
2141,12206,12015,15162,15068,14277,14234,15600,
14782,15298,15762,15956,15272,15713,14811,13814
,14194,1
5189,15646,15203,14973,15887,15566,14171,14061,
15750,15243,12248,11771,12211,12190,15542,16003
,15924,1
5669,14823,16144,14245,14141,15031,15777,15423,
15082,12149,12231,12258,11967,14264,13303,15164
,15089,1
5946,15190,15573,15662,14039,14281,13791,14250,
8111,8059,8169,8166,8125,8062,8177,8143,15193,15
704,155
45,14840,15135,15691,14591,15300,14069,14173,15
578,15245,14196,14304,16009,15895,15645,15055,1
5479,148
13,15953,15251,15784,15716,12156,12095,12214,12
235,14974,15084,14142,13820,15280,16064,15667,1
5563,152
05,15928,15764,14827,15035,15589,14260,14062,12
260,12217,12027,12154,12245,12127,11263,12203,1
5687,150
90,13307,14183,15519,15901,15194,15954,15753,15
812,14814,15304,15596,14719,14275,14257,15548,1
5246,161
37,15151,15915,15312,14070,13567,15206,16020,15
969,15253,14231,14187,15673,15577,14282,13951,1
5942,161
60,15063,15486,15778,14829,15693,15587,14252,14
073,8172,7677,8155,8126,8178,8123,8167,8157,1223
8,12023,
12264,12220,16012,15209,13309,14223,15720,15037
,15902,15267,15659,16134,15701,15809,15092,1567
0,15196,
14835,15067,15984,15574,15159,15911,15258,15535
,16010,14174,14289,15210,15768,15757,15254,1369
5,14067,
14278,14258,15972,15590,12143,12213,12243,12029
,14838,16131,14167,13310,15269,15702,14190,1423
5,15674,
16018,15923,15547,15824,15079,15694,15096,12237
,12272,12218,12157,15580,15917,15217,15483,1483
0,15715,
15608,15038,15257,15960,14837,15212,14047,14195
,15751,15183,16192,15780,15328,16033,13815,1428
4,14074,
14247,8180,8151,8174,8158,8184,7679,8171,8173,14
783,15943,15772,15705,14290,14201,15593,16040,1
4237,14
305,15069,16133,13822,14076,16005,15676,15567,1
5163,15926,15270,12250,11759,12259,12246,15970,
15810,15
218,15273,12191,12151,12261,12249,15299,15755,1
5083,15601,15455,14841,15717,15191,15260,16146,
14198,14
253,15070,15165,15899,15549,15947,15699,14292,1
4189,15766,15594,16024,15722,15301,15950,16066,
15575,14
254,14063,15274,15220,8179,8181,7935,8182,8185,8
063,8186,8183,14296,13819,14842,15663,15925,161
40,1425
9,14238,15085,15706,15976,15281,15302,15792,160
17,15091,12030,12266,12215,12252,15602,15195,14
197,1427
9,15763,15929,15724,15276,15550,15166,16145,152
47,12207,12155,12265,12262,15957,15918,16168,15
207,1430
6,14015,14975,15816,16034,15671,15224,15708,155
81,14815,15758,15604,14204,14143,14262,14283,15
282,1606
8,16013,15086,16138,15962,15729,15305,14308,142
65,14844,15949,15197,15782,16193,15675,15093,15
718,1530
6,16036,15579,15255,14075,14202,15930,15769,161
62,15840,15211,15971,15595,15198,12221,12158,12
273,1223
9,14293,14175,16256,16011,13311,14251,15781,150
94,12268,11773,12251,12222,15485,15284,15695,16
152,1593
2,16007,16048,15313,15721,15259,15958,15308,157
70,15647,14286,14071,16065,15097,15732,15213,14
312,1426
8,15543,15811,15785,16148,15288,16022,14831,155
98,14191,14261,15980,15955,15677,15765,16161,15
039,1570
7,15974,12274,12219,12263,12253,15903,16072,152
71,16021,15314,15961,15219,15098,15582,14839,15
794,1526
1,15730,15605,14291,14077,15214,15814,15071,161
35,14285,14320,16014,16196,14266,14205,15779,15
973,1429
8,13807,15817,15709,16035,15591,15329,15927,122
76,12247,12270,12254,16164,15788,15221,15275,15
330,1573
6,16080,15992,15316,16025,15262,15100,15606,152
77,15964,15703,16141,15793,14307,14294,16257,15
919,1572
3,15978,14239,14199,15303,15603,15820,15786,143
09,14297,15222,15167,16019,15678,16147,15283,16
041,1576
7,14843,15597,16176,15225,15986,15320,16096,158
26,15951,15087,14078,14314,16038,15278,16194,15
759,1579
6,15719,15332,16028,15977,16150,15307,15813,142
63,14300,15609,15848,16069,15226,15934,15710,14
255,1420
3,14845,16142,16258,15985,15285,15309,12280,117
75,12267,12269,15733,15825,16044,15963,15336,16
026,1522
8,15610,15774,16153,15726,15800,14313,14310,162
04,15286,15487,16067,15842,16163,15933,15199,14
269,1420
6,14321,14287,15787,15095,16200,16050,16037,157
31,8188,8187,8175,8127,8190,8191,8159,8189,16139
,15344,1
5959,15818,15612,14846,15771,15988,15315,15828,15289,16264,16165,15725,16074,15099,12275,12277,12031,12278,14316,13821,16208,15310,15789,15979,16049,16154,15551,15738,15965,15856,16166,16027,15290,15795,16070,15215,15317,15841,14299,14270,16042,15318,16260,15263,16169,15975,15783,16082,14322,14267,15679,16015,16156,16097,15815,15611,15331,16076,15737,16224,15101,15292,12281,12159,12282,12279,15832,16197,15223,15773,15321,16056,15333,15966,16149,15798,14311,14301,15734,15981,14324,14295,16184,16023,15583,16052,16272,15322,15819,15987,16081,15279,16195,15844,16170,15790,15227,16177,12284,12283,12271,12223,15334,15931,15614,15102,15801,16045,16100,15982,14318,14302,16073,14847,15821,15740,16029,16202,14328,13823,16288,15827,15324,15993,16088,16143,15735,16180,15337,15287,15990,16262,16043,15727,15338,15804,16172,15830,16209,15607,16030,15229,16259,15797,16084,16051,14315,14317,15311,16198,15230,16151,14323,14325,15833,15989,15846,16098,16178,15711,16039,15345,15802,16210,15291,16075,15822,16266,16225,15340,15994,16157,16054,16265,14079,14326,15935,15843,16112,15741,16071,16167,15829,15346,16320,15791,15293,16201,15319,16046,15294,15850,16212,16104,14329,14207,16057,16274,15996,15836,15739,16228,16155,16077,15852,15323,16268,15799,15348,16179,16085,15335,16174,15613,15983,16261,15834,16078,15849,16216,16053,15352,16289,16173,16203,15967,15805,16083,15103,16240,16060,15860,15325,15742,16090,16158,14330,14327,16171,15835,16280,16199,16226,15803,15339,15858,16099,16031,16186,15326,15341,16273,16058,16181,12286,12287,12255,12285,15831,15991,16101,16292,15823,16086,16205,15857,14332,14331,15295,16232,15599,16276,16106,16213,15845,16047,16092,16182,15347,16296,16120,16206,15998,15349,16321,16089,16263,15864,16185,16218,14319,14271,16102,15847,16290,16055,16113,15231,15775,15342,16214,16227,16275,15997,15838,16322,16188,16270,14334,14335,16059,16108,15851,16233,15350,15806,16079,16267,15353,16304,16217,16230,16105,15853,16114,16277,16159,15995,16328,16211,16091,15837,15354,16236,16061,15327,16269,16175,15861,16291,16324,16220,16062,16284,16116,15854,15356,16103,16241 16187,16229,16281,16093,15866,16294,15807,15343,16336,16183,16234,15859,16278,16297,16207,16107,15865,16248,16094,16325,16282,15862,16242,16219,16109,16293,16189,16312,15351,16087,16329,15839,16298,16117,16221,16244,16352,14303,14333,16190,15868,16308,16110,15355,16231,16323,16305,16118,15615,16279,16235,16330,15999,16300,16121,15357,16271,16222,16337,15743,16115,16326,16306,16215,15358,16238,16283,16095,16243,15863,16332,16122,16295,16338,16249,16285,16353,15870,16124,16246,16301,16340,16237,16302,16111,16344,15867,16307,16286,16245,16327,16354,16063,16252,16191,16310,16331,16356,16313,16123,16250,16341,16223,15359,16299,16334,16119,16360,16316,16239,16309,16339,16125,16333,16368,16314,16253,16346,15855,16355,16342,16287,16247,16357,16345,16126,16362,16311,16348,16303,16251,16361,16358,16317,16254,16369,16335,16364,15869,16347,16318,16370,16315,16359,16349,16372,16343,16366,16350,16376,15871,16363,16365,16371,16373,16127,16374,16377,16255,16378,16375,16380,16379,16367,16319,16382,16383,16351,16381]

**Sequence group 8: ZS_16384**

[0,1,2,7,3,8,11,24,4,10,13,28,16,33,35,77,5,12,14,32,19,38,47,81,22,46,42,88,57,96,102,168,6,17,21,40, 23,45,51,90,29,55,59,97,72,110,116,186,34,61,75,114,80,123,135,197,87,137,148,225,153,238,264,385,9,18,26,54, 30,58,71,105,36,76,62,117,84,127,142,206,44,74,86,136,92,145,152,233,100,155,170,252,184,272,291,432,53,89,98,151,111,162,178,269,121,179,196,283,210,305,321,473,139,204,230,311,236,324,349,510,257,357,379,543,400,572,615,879,15,25,31,73,39,79,82,141,48,85,93,150,101,160,165,266,56,94,103,163,115,177,193,286,126,194,205,300,232,318,344,493,64,108,122,183,128,195,213,313,149,228,237,326,256,355,373,542,164,246,270,361,284,393,402,567,307,420,458,602,483,636,714,885,69,124,144,216,159,235,255,359,169,258,275,384,292,401,431,591,191,287,301,413,325,446,477,650,338,486,515,682,551,72

4,758,1039,212,314,332,462,362,492,519,703,397,53
9,568,74
8,604,762,846,1136,429,582,616,801,631,865,901,12
01,709,929,967,1192,1011,1269,1375,1794,20,37,41,
91,49,95,
106,176,50,107,118,187,132,207,217,340,63,119,133,
222,146,231,244,341,154,243,265,378,288,396,408,5
66,67,14
3,156,224,173,247,271,394,181,279,293,410,304,443,
466,628,180,302,316,442,337,480,495,683,366,529,5
52,723,5
80,756,806,1101,78,167,174,277,190,298,315,433,19
8,320,330,475,350,508,533,721,259,345,363,513,386,
549,577,
750,423,586,622,794,653,862,916,1182,297,381,411,
559,439,601,626,848,471,642,666,878,715,944,978,1
243,516,
711,725,968,751,1013,950,1297,821,1089,1137,1394,
1149,1531,1607,1889,83,188,192,336,248,354,372,52
8,278,3
77,387,556,422,588,621,850,294,414,438,589,460,62
7,657,888,487,671,702,934,749,975,1035,1313,339,4
44,465,6
56,494,693,733,954,554,736,760,1031,822,995,1119,
1412,599,786,856,1093,889,1148,1187,1486,945,119
5,1194,1
587,1299,1639,1699,2096,380,484,530,737,587,761,8
05,1051,623,849,867,1138,926,1157,1193,1525,660,8
97,960,
1183,982,1199,1305,1641,1047,1326,1371,1709,1438
,1817,1886,2309,722,972,1025,1307,1117,1316,1426,
1752,11
34,1418,1496,1845,1558,1925,2038,2502,1159,1544,
1629,1965,1678,2068,2002,2567,1789,2153,2216,275
4,2352,2
848,3015,3419,27,43,52,99,60,120,134,214,66,138,14
7,221,158,241,245,390,68,157,166,240,175,299,308,4
28,200,
310,335,472,352,497,531,746,70,172,189,303,202,33
3,346,490,215,358,374,540,392,573,596,764,229,382,
405,584,
434,620,637,828,448,629,673,896,680,932,973,1389,
109,201,211,351,223,375,391,558,253,409,424,608,4
51,648,6
70,854,276,427,464,634,489,678,689,918,512,691,70
0,977,784,1014,1083,1414,295,488,506,698,548,727,
745,987,
576,783,811,1046,870,1102,1139,1501,607,845,892,1
145,946,1178,1253,1561,1021,1260,1330,1656,1372,
1727,18
34,2298,112,219,242,403,274,425,459,652,290,467,4
91,692,517,705,717,984,319,507,545,719,575,774,80
3,1042,6
05,826,868,1130,919,1160,1227,1506,347,557,595,80
7,638,857,855,1163,661,900,930,1202,989,1257,1285
,1661,7
04,947,1017,1270,1043,1345,1374,1760,1088,1406,1
475,1846,1575,1935,2061,2531,368,614,643,902,688,
943,991,
1261,771,1020,1066,1367,1070,1384,1433,1813,787,
1068,1087,1423,1175,1474,1550,1922,1240,1572,162
7,1968,1
693,2106,2178,2594,827,1189,1216,1509,1290,1591,
1638,2023,1331,1683,1763,2140,1835,2224,2323,278
5,1481,1
769,1853,2241,1962,2378,2427,2969,2025,2473,2565
,3063,2669,3228,3381,4006,129,254,282,470,317,505
,541,75
5,328,550,583,781,609,818,887,1229,360,597,651,85
1,675,941,921,1242,694,961,1010,1325,1062,1351,13
92,1790,
435,664,695,935,770,986,1026,1370,780,1065,1081,1
393,1116,1434,1485,1899,788,1098,1152,1483,1238,
1547,16
19,1971,1280,1671,1692,2113,1768,2179,2277,2733,
450,769,773,1044,793,1069,1129,1456,844,1176,121
3,1527,1
258,1598,1680,2073,1016,1231,1296,1621,1335,1724
,1771,2155,1439,1784,1872,2247,1964,2370,2407,29
59,1080,
1344,1422,1726,1482,1842,1906,2295,1556,1931,198
6,2404,2069,2475,2592,3137,1636,2030,2132,2564,2
211,263
6,2732,3242,2306,2757,2829,3370,2910,3539,3572,4
415,463,795,817,1225,985,1247,1284,1669,1033,131
7,1363,1
743,1430,1805,1897,2285,1085,1390,1477,1821,1523
,1909,1989,2397,1606,2066,1977,2459,2158,2575,26
68,3163,
1241,1487,1546,1943,1659,2006,2115,2554,1705,213
3,2210,2637,2273,2673,2805,3331,1838,2235,2318,2
741,243
5,2868,2949,3467,2498,3052,3106,3646,3229,3756,3
794,4238,1340,1551,1702,2138,1795,2196,2238,2716
,1887,23
47,2382,2822,2461,2869,3067,3566,1903,2443,2556,
3036,2666,3142,3147,3790,2765,3256,3319,3851,344
6,4036,4
135,4725,2076,2630,2638,3210,2818,3260,3372,3889
,2906,3466,3504,4096,3673,4140,4455,4954,3001,36
23,3723,
4294,3864,4337,4580,5137,3963,4614,4720,5330,485
6,5494,5607,6248,140,113,65,289,104,267,182,518,1
25,185,2
03,456,220,356,327,600,161,218,239,334,268,412,37
6,699,306,388,430,569,474,775,640,981,171,249,273,
395,309,
421,481,617,329,509,447,884,555,665,710,1385,353,
485,585,679,538,744,841,1167,610,816,772,1030,917
,1230,10
71,1762,199,296,312,461,348,496,565,718,383,633,5
11,759,598,789,864,1086,415,553,677,829,641,976,8
10,1135,
590,869,1012,1188,940,1450,1268,2152,449,674,611,
927,763,886,1040,1215,708,1099,966,1348,1027,128
9,1670,1

530,800,1050,1121,1497,1166,1368,1413,1816,1217,
1573,1459,2031,1657,2434,1923,2950,234,331,369,5
44,404,5
81,632,847,445,720,603,876,667,924,988,1306,476,6
39,765,933,701,1082,969,1281,792,1032,1153,1373,1
103,142
8,1553,1860,514,754,681,994,866,1063,1161,1403,84
0,1237,1084,1682,1203,1494,1507,1978,928,1150,13
24,1552,
1259,1597,1744,2484,1395,1788,1664,2021,1896,218
1,2276,3096,574,782,893,1131,820,1174,1287,1571,9
51,1360 ,1212,1841,1415,1626,1739,2112,1015,1252,
1429,1676,1526,1772,1970,2199,1327,1917,1804,239
6,2028,2308,256
6,3312,1067,1480,1559,1927,1366,1847,1999,2629,1
637,2102,2193,2406,1888,2755,2503,4244,1698,2141
,2246,27
17,2311,2585,2672,3535,2060,2826,2911,3209,3014,
3909,3380,5407,285,389,426,635,482,726,672,980,50
4,690,85
8,1038,768,1096,1156,1458,564,802,747,1128,863,12
71,1074,1524,942,1177,1304,1590,1224,1812,1725,2
465,606,
877,819,1388,1024,1162,1228,1599,925,1256,1341,1
956,1419,1667,1773,2217,1045,1457,1369,1840,1560
,1747,19
63,2305,1505,1916,2014,2375,2111,2518,2735,3184,
649,1118,903,1291,974,1484,1350,1852,1075,1402,1
533,1791 ,1596,1926,2024,2436,1186,1677,1508,218
9,1435,1958,2007,2675,1785,2099,2225,2536,2307,2
623,2831,3611,124
6,1708,1594,2039,1823,2154,2379,2811,1934,2458,2
195,2712,2272,3055,2944,3483,1640,2346,2584,2979
,2474,28
74,3278,3460,2639,3222,3097,3844,3427,3699,4037,
5586,732,990,1144,1451,1214,1522,1742,2072,1288,
1874,155
7,2139,1665,1988,2310,2807,1092,1620,1703,2270,1
844,2519,2192,2749,1987,2401,2464,3022,2098,3243
,2918,44
54,1391,1761,1924,2614,2075,2426,2371,3180,1822,
2496,2725,2968,2633,3078,3361,3749,2239,2677,257
4,3107,2
810,3555,3263,3859,2945,3382,3630,4087,3505,4002
,4581,4953,1476,1959,2123,2485,1875,2823,2593,32
08,2299,
2622,3007,3328,2724,3426,3668,4202,2022,2875,276
7,3445,3037,3722,3533,4158,3234,3578,3926,4073,3
835,468
7,4518,5178,2403,3143,2956,3687,3335,4266,3604,4
395,2827,3960,3795,4550,3850,4649,4853,6597,3101
,4219,40
97,4996,4013,4808,5092,5736,4373,5019,4921,5945,
5291,7245,5800,7789,367,457,532,757,594,785,859,1
158,630,
979,823,1312,920,1200,1380,1738,676,871,1041,123
6,955,1513,1298,1811,1097,1432,1595,2180,1407,18
61,1942,
2538,716,1034,983,1362,1120,1427,1570,1976,1239,
1679,1495,1902,1660,2029,2287,2701,1179,1618,154
5,2020,1
746,2218,2114,2631,1843,2271,2400,3373,2440,2958
,2830,3686,804,1064,1226,1512,1361,1574,1920,209
7,1151,1
628,1770,2188,1666,2353,2197,2784,1334,1820,1873
,2515,1704,2286,2460,3006,2067,2557,2325,2903,26
74,3100,
3261,3977,1504,1908,2122,2405,1998,2615,2537,316
7,2234,2820,2713,3079,2514,3279,3403,3922,1969,2
859,276
4,3329,3023,3579,3468,4159,2657,3447,3674,4667,3
834,4487,4336,5465,931,1381,1198,1745,1286,2110,
1681,244
1,1532,1810,1979,2415,1930,2322,2606,3185,1500,2
240,2015,2734,1907,2555,2499,3297,2194,2667,2907
,3103,28
19,3434,3538,4113,1658,2077,2304,2628,2383,2978,
2804,3622,2103,2748,3146,3482,2902,3383,3791,426
7,2442,3
082,2973,3559,3313,3962,3680,4409,3257,3820,4146
,4546,4012,4724,4812,6077,1839,2472,2198,2951,23
19,2828,
3136,3716,2539,3418,3062,3647,3211,3849,3927,458
8,2656,3330,3181,4003,3558,3888,4203,5176,3452,4
357,403
8,4686,4284,4920,5043,5700,2766,3191,3605,4112,3
402,4194,4394,4857,3805,4648,4260,5018,4547,5101
,5311,59
41,3698,4414,4664,5587,4852,5236,5406,6351,4326,
5487,5738,6198,5801,6487,6854,8096,1100,1431,134
9,2003,1
586,2107,1957,2595,1668,1898,2324,3000,2219,2676
,2849,3453,1753,2284,2159,2740,2497,3262,2821,35
73,2437,
2919,3083,3848,3190,3675,4039,4666,1921,2530,240
2,2957,2632,3054,3102,3717,2294,3166,3360,4072,3
532,397
3,3908,4797,2756,3371,3610,3865,3461,4147,4285,4
970,3296,4380,4134,4859,4522,5115,5290,6117,2074
,2374,28
06,3334,2607,3235,3567,4085,2972,3757,3435,3976,
2948,4218,4327,5003,3066,3534,3631,4671,3804,426
1,4470,5
606,3961,4644,4381,5100,4811,5237,5556,6237,3223
,3672,4086,4471,3845,4866,4645,5331,4239,4551,49
71,5449,
4721,5895,5638,6418,4007,4858,5093,5701,5244,602
2,5886,6705,5042,5765,6199,6953,6116,6589,7103,8
229,241
4,2700,2858,3554,3162,3923,3469,4372,3053,3681,3
669,4589,3858,4796,4523,5495,3318,4141,3821,4486
,4245,46
65,4997,5448,4084,4867,5067,5639,4813,5792,5963,
6704,3444,3972,4408,4809,4195,5114,4952,5739,429
5,5002,5
179,6249,5486,5887,5940,6952,4615,5379,5597,5962,5310,6419,6118,6908,5136,6161,6588,7379,6381,7102,7325,8957,3748,4356,4519,5378,4810,5066,5596,6023,4670,5177,5464,6119,5737,6536,6350,7113,4955,5557,5764,6486,5894,6236,6679,7551,5944,6739,6596,7324,6909,7519,7721,9888,5245,5793,6076,6678,6160,6738,7041,7518,6380,7040,6855,7888,7244,7889,7720,8956,6537,7112,7378,7898,7550,7899,8097,8499,7788,8228,8498,8741,8740,9889,9086,9087,130,131,208,251,209,280,323,440,226,322,343,478,370,535,537,791,227,342,364,534,399,570,619,825,436,618,592,860,669,912,948,1248,250,371,407,578,437,613,655,890,479,663,697,913,776,970,1018,1328,536 ,707,779,1008,824,1037,1095,1347,853,1113,1164,1493,1181,1528,1616,2037,281,398,468,662,498,696,767,953,546,790,712,1019,842,1061,1132,1404,612,778,852,1112,894,1147,1180,1511,922,1185,1250,1584,1318,1642,1701,2182,659,861,914,1173,971,1206,1266,1625,1029,1267,1346,1685,1416,1755,1815,2293,1115,1400,1502,1793,1520,1818,1915,2398,1593,1941,2017,2481,2100,2600,2703,3401,365,441,499,777,571,809,830,1123,624,843,895,1172,923,1204,1219,1622,668,898,949,1207,1009,1265,1339,1694,1060,1342,1401,1736,1510,1808,1910,2369,734,964,1036,1315,1072,1343,1421,1801,1165,1498,1521,1832,1592,1933,2001,2480,1218,1562,1630,1967,1686,2079,2104,2573,1775,2136,2244,2664,2327,2758,2970,3413,753,1048,1146,1436,1197,1515,1589,1961,1249,1604,1649,2036,1706,2101,2177,2627,1337,1695,1737,2131,1819,2226,2317,2790,1900,2348,2425,2880,2501,3002,3064,3719,1420,1802,1862,2254,1984,2368,2439,2923,2087,2477,2586,3032,2670,3080,3282,3916,2163,2610,2714,3179,2747,3337,3437,4077,2961,3471,3575,4068,3657,4247,4453,5230,406,547,579,891,625,899,962,1264,654,963,1022,1329,1090,1405,1437,1904,713,1023,1091,1478,1154,1503,1554,1905,1184,1549,1617,2016,1696,2086,2120,2572,739 ,1133,1190,1492,1255,1563,1631,2084,1283,1663,1707,2128,1754,2221,2274,2744,1282,1740,1806,2220,1891,2320,2373,2881,1990,2457,2512,2999,2608,3060,3188,3863,808,1245,1262,1651,1336,1722,1803,2183,1364,1814,1854,2297,1918,2394,2467,2997,1605,1911,1985,2413,2062,2487,2605,3034,2143,2620,2726,3176,2809,3332,3454,4058,1721,2019,2129,2553,2209,2659,2742,3284,2279,2786,2846,3400,2971,3510,3602,4193,2432,2963,3003,3576,3035,3659,3552,4287,3241,3833,3917,4484,3925,4765,4875,5377,831,1332,1338,1890,1568,1932,2000,2456,1662,2013,2063,2528,2142,2624,2719,3286,1710,2134,2208,2625,2252,2743,2817,3416,2349,2851,2922,3498,3033,3595,3703,4325,1901,2222,2269,2816,2372,2905,3013,3556,2516,3020,3076,3697,3258,3645,3893,4528,2651,3158,3314,3847,3417,3924,4065,4630,3511,4071,4070,4855,4293,4937,5069,5748,2018,2344,2462,3021,2621,3077,3187,3759,2727,3285,3339,3918,3464,3975,4069,4749,2824,3433,3564,4059,3608,4075,4297,4939,3751,4364,4429,5079,4590,5263,5350,6105,2998,3592,3683,4299,3891,4338,4568,5112,3910,4544,4650,5307,4800,5471,5676,6416,3979,4780,4915,5539,5020,5698,5604,6473,5191,5873,5946,6812,6162,6954,7189,7723,469,593,658,915,706,1028,1094 ,1424,738,1114,1155,1473,1196,1535,1555,2070,752,1191,1244,1534,1263,1723,1786,2162,1382,1792,1885,2292,1928,2377,2463,3030,766,1254,1333,1741,1386,1863,1912,2354,1425,1960,2004,2478,2078,2601,2648,3098,1499,2026,2109,2612,2190,2718,2759,3270,2232,2745,2857,3432,2872,3496,3593,4475,965,1383,1417,1919,1479,2005,2071,2552,1585,2121,2156,2692,2237,2788,2850,3298,1650,2161,2268,2752,2351,2870,2883,3456,2412,2901,2920,3601,3156,3660,3803,4530,1711,2350,2392,2916,2486,3005,3029,3615,2604,3155,3221,3750,3368,3866,3919,4669,2679,3281,3424,3921,3536,4056,4217,4803,3671,4236,4366,4956,4430,5097,5288,6078,992,1449,1548,2105,1648,2157,2245,2808,1700,2275,2355,2904,2433,2947,2975,3612,1809,2393,2483,2977,2603,3144,3183,3740,2671,3268,3362,3902,3457,4000,4133,4704,1913,2529,2635,3189,2772,3315,3299,4005,2825,3436,3480,4078,3621,4221,4263,4969,2946,3537,3663,4256,3741,4393,4452,5116,3832,4520,4607,5308,4835,5517,5679,6433,1996,2702,2787,3438,2882,3509,3629,4237,3139,3670,3784,4411,3788,4472,4579,5261,3159,3786,3823,4549,4041,4606,4792,5468,4190,4832,4913,5544,5065,5794,5888,6522,3269,4067,4102,4707,4270,4865,4936,5657,4367,5041,5119,5858,5289,5964,6123,6853,4625,5139,5329,5991,5536,6188,6251,7115,5659,6365,6455,7223,6667,7450,7655,8442,1073, 1588,1684,2278,1807,2381,2479,3039,1836,2500,261
1,3153,2693,3232,3415,4143,1966,2649,2791,3287,2
865,350
7,3459,4192,2908,3565,3656,4359,3772,4403,4482,5
228,2191,2844,2909,3499,3138,3614,3684,4428,3152
,3775,38
01,4483,3890,4582,4629,5391,3160,3860,3942,4627,
4188,4783,4905,5547,4258,5001,5064,5805,5138,588
9,6053,6
777,2236,3105,3141,3742,3165,3787,3901,4598,3280
,4042,4099,4751,4222,4872,5022,5703,3662,4145,42
86,4907,
4375,5094,5157,5875,4591,5188,5338,6021,5538,618
4,6223,7101,3800,4392,4548,5096,4626,5304,5420,6
075,479
8,5493,5558,6220,5699,6367,6520,7305,4922,5666,5
838,6454,5943,6634,6776,7478,6090,6815,6921,7622
,7034,78
55,7896,9035,2255,3177,3231,4115,3613,4201,4262,
4999,3701,4339,4407,5103,4576,5239,5389,6055,380
7,4480,4
613,5281,4727,5423,5585,6197,4874,5696,5549,6325
,5884,6475,6666,7357,4191,4631,4782,5519,4959,56
36,5807,
6446,5077,5839,5942,6635,6039,6673,6873,7613,529
2,5967,6120,6805,6261,6958,7043,7827,6410,7206,7
286,803
8,7451,8192,8224,8742,4382,4793,5070,5856,5231,5
920,5988,6706,5351,6135,6190,6902,6327,6959,7247
,7890,54
05,6315,6452,7204,6664,7306,7327,8194,6849,7504,
7597,8299,7816,8470,8619,9313,5726,6618,6644,743
4,6882,7
506,7652,8325,7032,7826,7844,8550,8043,8632,9045
,9542,7149,8035,8117,8896,8310,8913,9224,9779,83
91,9248,
9298,10014,9512,10206,10299,10882,1122,993,735,1
697,952,1623,1314,2438,1049,1319,1387,2242,1472,
1940,18
33,2658,1205,1448,1529,1884,1624,2130,2012,2917,
1774,2064,2176,2587,2296,3145,2774,3607,1251,156
9,1643,2
085,1787,2137,2321,2715,1837,2395,2227,3412,2517
,2845,2962,4473,1929,2345,2613,2871,2476,3028,32
77,4015,
2694,3230,3140,3696,3455,4144,3789,5118,1365,172
0,1800,2253,1914,2376,2559,2976,2027,2751,2399,3
065,265
0,3161,3336,3822,2135,2513,2867,3271,2775,3600,3
220,3911,2626,3363,3658,4066,3506,4596,4246,5872
,2233,28
64,2695,3465,3081,3414,3720,4101,2960,3861,3574,
4400,3685,4269,5000,4764,3178,3758,3895,4651,401
4,4412,4
529,5262,4103,4833,4605,5667,4957,6260,5469,7072
,1514,1855,1997,2482,2108,2609,2750,3283,2223,29
96,2665,
3374,2847,3462,3620,4298,2316,2773,3099,3497,292
1,3802,3577,4259,3164,3700,3943,4431,3867,4570,4
795,533
6,2424,3038,2873,3644,3338,3773,4001,4517,3276,4
157,3806,5040,4079,4646,4705,5550,3470,3940,4358
,4794,42
23,4871,5108,6382,4485,5190,4984,5647,5388,5891,
6052,7272,2602,3154,3425,3903,3240,4040,4265,481
5,3553,4
404,4098,5295,4531,4912,5099,5804,3661,4216,4571
,5016,4750,5158,5546,5923,4365,5451,5238,6196,56
64,6104,
6472,7566,3785,4624,4801,5485,4410,5309,5599,661
7,4923,5766,5901,6222,5376,6813,6417,8804,5068,5
859,602
0,6707,6107,6485,6672,7853,5678,6910,7035,7433,7
188,8327,7654,10043,1687,2065,2160,2753,2326,300
4,2856,3
606,2380,2900,3316,3718,3104,3856,3974,4604,2558
,3182,3031,3900,3333,4257,3792,4748,3508,4043,42
96,4864,
4114,5260,5095,6349,2678,3375,3233,4474,3682,400
4,4142,4873,3463,4220,4383,5524,4545,4987,5159,5
947,374
3,4599,4413,5294,4802,5111,5537,6089,4685,5450,5
644,6187,5803,6422,6779,7400,2789,3892,3439,4271
,3594,46
28,4402,5328,3793,4516,4767,5229,4870,5484,5658,
6262,4064,5017,4706,5893,4583,5526,5637,6675,518
9,5751,5
965,6434,6091,6599,6923,8033,4200,5078,4868,5677
,5283,5874,6189,6881,5516,6324,5903,6694,6038,72
21,7038,
7843,4938,6134,6484,7127,6366,7008,7548,7824,664
5,7448,7273,8246,7737,8101,8471,10242,3012,3628,
3920,45
97,4100,4726,5102,5702,4268,5348,4799,5857,4985,
5584,6106,6875,3846,4906,5071,6036,5306,6423,590
0,6807,5
559,6213,6348,7190,5750,7479,7036,9044,4481,5117
,5470,6590,5725,6250,6185,7376,5282,6408,6737,71
14,6633,
7256,7621,8119,5989,6677,6474,7287,6880,7869,751
7,8309,7039,7660,8036,8549,7845,8440,9225,9541,4
612,552
7,5837,6383,5349,6903,6521,7432,6079,6598,7151,7
598,6736,7736,8040,8716,5656,7009,6851,7791,7205
,8116,78
47,8692,7476,8008,8358,8545,8245,9297,9066,9838,
6215,7307,7074,8099,7615,8844,8010,8959,6911,838
8,8225,9
134,8298,9253,9455,11325,7275,8719,8551,9598,846
9,9436,9724,10412,8941,9659,9523,10665,9891,1176
5,10468 ,12357,1991,2243,2466,3061,2634,3157,331
7,3978,2746,3603,3259,4324,3458,4076,4468,5098,2
866,3369,3721,41
56,3557,4723,4292,5247,3857,4578,4869,5890,4521,
5337,5518,6444,2974,3702,3609,4406,3894,4569,481
4,5548,4

189,5021,4647,5404,4968,5665,6073,6693,4057,4904,4781,5646,5110,5960,5806,6619,5305,6037,6212,7653,6312,
7100,6922,8098,3186,3774,4132,4722,4405,4834,5466,5749,3941,4914,5156,5892,4986,6163,5921,6852,4374,528
0,5339,6421,5076,6072,6326,7150,5697,6453,6133,7011,6674,7274,7507,8427,4684,5422,5836,6221,5598,6591,64
35,7359,5966,6900,6695,7257,6420,7549,7663,8356,5545,6957,6848,7599,7191,8009,7840,8693,6647,7817,8088,9
289,8244,9065,8912,10103,3481,4469,4074,5109,4264,5802,5023,6313,4766,5246,5551,6239,5492,6122,6538,740
1,4668,5990,5645,6778,5421,6447,6411,7565,5902,6665,7033,7285,6883,7738,7854,8617,4958,5727,6088,6616,61
91,7126,6872,8034,5767,6806,7326,7842,7010,7661,8195,8845,6314,7258,7125,7871,7567,8390,8090,9033,7505,8
230,8634,9132,8468,9312,9452,10691,5293,6364,5922,7073,6121,6920,7304,8102,6445,7722,7222,8039,7435,829
7,8359,9226,6646,7612,7377,8441,7870,8324,8717,9836,7818,8915,8496,9296,8846,9522,9721,10314,6850,7403,8
011,8616,7662,8694,8958,9513,8227,9252,8806,9658,9133,9727,10013,10607,8100,9034,9254,10243,9454,9880,1
0042,11017,8898,10205,10414,10878,10469,11131,11536,12570,3862,4577,4401,5605,4854,5795,5525,6523,4998,
5390,6132,7148,5961,6676,6955,7819,5113,6054,5885,6804,6409,7516,6901,7897,6263,7037,7259,8296,7402,808
9,8497,9288,5467,6432,6214,7075,6632,7220,7284,8103,6074,7358,7620,8544,7846,8425,8326,9315,6814,7623,80
32,8311,7825,8635,8847,9596,7564,8942,8618,9515,9084,9777,9890,10817,5724,6186,6874,7614,6539,7477,7891,
8547,7124,8193,7739,8426,7042,8718,8899,9657,7246,7852,8037,9291,8226,8807,9046,10298,8389,9250,8943,97
26,9439,9881,10240,10881,7449,8042,8548,9047,8247,9520,9251,10015,8743,9135,9597,10101,9299,10605,10312 ,11128,8443,9514,9725,10315,9882,10688,10470,11357,9720,10449,10879,11609,10816,11175,11745,12745,6238,
6692,6956,7868,7356,8357,7841,8940,7207,8091,8041,9227,8308,9314,9085,10207,7596,8633,8231,9064,8805,92
55,9599,10100,8546,9521,9723,10313,9453,10450,10667,11356,7790,8424,9032,9437,8695,9776,9540,10415,8897 ,9656,9839,10883,10204,10471,10606,11608,9249,10041,10297,10666,10012,11129,10818,11538,9778,10877,111
74,11937,11019,11744,11767,12895,8118,8914,9067,10040,9438,9722,10296,10689,9290,9837,10102,10819,1041
3,11172,11016,11747,9543,10241,10448,11130,10604,10880,11327,12073,10664,11359,11324,11766,11539,11939,
12075,13602,9883,10451,10690,11326,10876,11358,11611,11938,11018,11610,11537,12358,11764,12359,12074,1
2894,11173,11746,11936,12568,12072,12569,12571,12747,12356,12744,12746,12893,12892,13603,13600,13601,2
60,261,262,419,263,452,455,684,416,454,501,728,560,741,743,1125,417,500,502,740,563,798,875,1141,646,874,8
14,1208,957,1232,1294,1652,418,561,645,812,647,873,883,1210,729,939,959,1233,1076,1310,1376,1758,742,997,
1079,1322,1140,1399,1463,1781,1171,1489,1540,1937,1565,1982,2116,2581,453,562,686,938,730,958,1059,1301,
796,1124,998,1377,1168,1411,1518,1850,872,1078,1170,1488,1220,1537,1564,1973,1292,1567,1654,2056,1756,21
44,2215,2760,937,1209,1234,1543,1311,1634,1690,2125,1397,1691,1780,2167,1858,2281,2329,2897,1491,1848,19
54,2291,1980,2332,2445,3018,2081,2453,2571,3087,2652,3212,3343,4083,503,685,731,1077,799,1127,1142,1517,
880,1169,1221,1542,1293,1632,1645,2118,956,1222,1295,1635,1323,1689,1777,2186,1410,1778,1849,2264,1972,2
314,2428,2981,1052,1308,1398,1751,1452,1779,1877,2301,1541,1952,1981,2334,2080,2451,2561,3086,1644,2010,
2126,2469,2184,2597,2654,3195,2283,2720,2854,3266,2927,3408,3642,4105,1057,1408,1536,1880,1603,1975,205
9,2455,1653,2082,2147,2580,2228,2653,2739,3247,1767,2187,2265,2697,2333,2814,2913,3430,2418,2954,3027,35
70,3123,3712,3778,4479,1876,2302,2408,2862,2470,2980,3051,3599,2617,3075,3196,3752,3272,3782,3982,4744,2
737,3226,3364,3897,3399,4045,4137,4889,3625,4185,4303,4860,4379,5045,5243,6102,644,797,813,1211,881,1223 ,1302,1688,882,1303,1378,1759,1460,1851,1881,2420,999,1379,1461,1894,1538,1955,2008,2421,1566,1995,2117,
2570,2212,2616,2688,3194,1055,1519,1600,1936,1673,2011,2127,2598,1749,2151,2229,2690,2280,2803,2878,339
6,1748,2266,2312,2802,2417,2924,2983,3571,2534,3057,3124,3679,3224,3776,3906,4641,1126,1647,1674,2149,17
66,2250,2303,2761,1782,2328,2358,2899,2446,3016,3069,3677,2083,2429,2471,3025,2582,3121,3217,375

4,2723,3 238,3378,3886,3441,4034,4152,4822,2249,2577,2691 ,3151,2771,3265,3394,4008,2887,3422,3502,4082,36 43,4232, 4334,4979,3048,3627,3713,4320,3755,4385,4242,508 9,3953,4593,4745,5286,4757,5595,5723,6257,1143,1 764,177 6,2416,2032,2450,2560,3056,2150,2569,2583,3148,2 722,3244,3377,4010,2230,2698,2770,3245,2860,3395 ,3449,41 08,2955,3531,3598,4198,3753,4331,4467,5129,2419, 2812,2877,3448,2982,3585,3725,4282,3126,3736,378 0,4451,3 954,4371,4683,5332,3255,3870,4020,4601,4109,4756 ,4839,5446,4233,4863,4862,5655,5091,5819,5907,66 08,2576, 2952,3058,3737,3239,3781,3905,4535,3379,4009,404 7,4746,4174,4777,4861,5589,3484,4129,4288,4823,4 342,487 9,5105,5821,4527,5142,5235,5937,5386,6145,6254,7 005,3678,4328,4425,5107,4681,5132,5370,6032,4742 ,5342,54 80,6193,5630,6333,6542,7322,4779,5616,5797,6393, 5862,6576,6458,7423,6097,6741,6808,7718,7052,782 8,8095,8 651,687,815,936,1235,996,1396,1462,1878,1054,149 0,1539,1893,1602,1993,2009,2590,1056,1601,1646,1 992,1675 ,2251,2288,2736,1796,2290,2411,2896,244 8,2993,3059,3746,1058,1672,1765,2267,1798,2409,2 430,2966,1879,245 4,2562,3084,2596,3213,3252,3796,1953,2578,2661,3 236,2762,3376,3409,3964,2840,3397,3541,4128,3568 ,4196,43 29,5269,1309,1797,1859,2447,1895,2563,2591,3150, 2057,2689,2728,3300,2843,3428,3530,4018,2148,273 1,2876,3 406,2965,3562,3581,4154,3024,3583,3596,4333 ,386 8,43 86,4575,5334,2231,2964,3010,3590,3120,3715,3745, 4355, 3216,3855,3915,4526,4062,4642,4747,5489,3275,398 1,4116,4753,4234,4818,4993,5633,4397,5032,5154,5 840,524 0,5987,6166,6998,1320,1883,1994,2655,2146,2729,2 855,3440,2214,2879,2967,3584,3049,3617,3665,4352 ,2315,30 11,3109,3667,3215,3838,3899,4514,3273,3958,4060, 4738,4155,4784,4927,5514,2431,3149,3251,3907,341 0,4021,4 019,4787,3485,4136,4186,4890,4361,5005,5053,5845 ,3616,4235,4389,5046,4515,5185,5242,6048,4592,53 18,5435, 6194,5651,6363,6553,7355,2540,3342,3423,4138,358 0,4207,4363,5033,3819,4396,4558,5227,4562,5264,5 381,612 9,3871,4560,4587,5347,4807,5434,5622,6330,4976,5 648,5763,6396,5897,6622,6762,7474,3959,4849,4916 ,5521,50 74,5663,5818,6507,5155,5879,6051,6708,6167,6828, 7019,7757,5441,6057,6209,6897,6390,7118,7219,801 3,6509,7 277,7421,8163,7585,83 96,8605,9414,1453,2058,2166,2886,23 13,3009,3085,3771,23 56,3 122,3227,3 853,3 301,393 8, 4107,4941,2468,3253,3431,4011,3543,4205,4169,497 8,3586,4289,4378,5141,4554,5203,5284,6098,2763,3 500,358 7,4199,3818,4354,4426,5234,3852,4557,4573,5285,4 680,5382,5445,6291,3880,4610,4760,5443,4974,5619 ,5743,63 99,5048,5855,5896,6641,6056,6763,6977,7657,2842, 3817,3837,4524,3885,4561,4737,5416,3980,4816,490 9,5591,5 006,5674,5876,6581,4388,4943,5088,5745,5171,5984 ,6059,6743,5387,6092,6232,6907,6392,7078,7187,80 03,4572, 5184,5346,5986,5442,6174,6306,6995,5628,6347,643 8,7184,6577,7279,7472,8233,5816,6526,6696,7420,6 803,754 4,7656,8414,7002,7725,7805,8574,7934,8803,8856,9 871,2863,3887,3937,4925,4353,4983,5052,5853,4465 ,5133,52 07,6015,5374,6113,6289,6981,4585,5270,5437,6149, 5555,6309,6441,7177,5722,6558,6413,7263,6746,743 9,7584,8 303,4977,5447,5618,6379,5843,6462,6643,7406,5925 ,6697,6802,7545,6965,7589,7773,8503,6170,6879,70 14,7697, 7227,7872,7981,8711,7310,8132,8214,8974,8397,912 8,9174,9654,5180,5623,5910,6702,6103,6796,6886,7 636,625 5,7047,7122,7798,7265,7873,8167,8842,6295,7243,7 416,8128,7574,8238,8243,9170,7741,8428,8479,9223 ,8690,94 40,9551,10229,6584,7530,7546,8386,7794,8432,8600 ,9273,7930,8710,8756,9524,8997,9560,9895,10514,8 065,895 5,9043,9734,9244,9781,10084,10693,9359,10114,102 24,10886,10388,11022,11135,11760,1516,1321,1053, 2213,13 00,2119,1750,3050,1409,1757,1799,2852,1892,2452, 2335,3264,1633,1882,1983,2410,2124,2696,2568,359 1,2282,2 588,2738,3197,2898,3839,3420,4341,1655,2033,2145 ,2599,2289,2721,2925,3365,2357,3017,2815,4104,31 27,3501, 3626,5265,2449,2953,3237,3563,3074,3744,3969,479 1,3302,3936,3836,4450,4153,4942,4563,6050,1783,2 248,230 0,2861,2444,2992,3193,3666,2579,3405,3019,3779,3 254,3881,4044,4586,2699,3125,3561,3965,3421,4332 ,3914,47 43,3246,4061,4384,4848,4204,5402,5044,6740,2841, 3542,3303,4175,3783,4106,4512,4911,3624,4611,430 2,5200,4 427,5073,5854,5594,3896,4534,4709,5481,4790,5232,5333,6144,4917,5649,5419,6527,5841,7226,6331,7982,1974, 2359,2541,3108,2660,3225,3404,3983,2813,3676,3267,4080,3503,4172,4360,5106,2912,3411,3797,4197,3597,457 4,4321,5049,3884,4464,4761,5241,4643,5372,5625,6216,3026,3770,3569,4370,4046,4555,4785,5315,3968,4973,45 84,5878,4891,5454,5515,6414,4184,4758,5140,5624, 5007,5673,6016,7292,5287,6096,5848,6505,6288,6765,6976,8 196,3214,3854,4117,4739,3952,4806,5055,5643,4243,5204,4908,6173,5335,5762,6011,6640,4387,4992,5373,5860, 5590,6060,6398,6799,5143,6321,6112,7176,6524,7004,7422,8472,4559,5440,5631,6335,5226,6195,6451,7529,581 7,6614,6793,7186,6256,7719,7323,9660,5906,6709,6906,7637,7007,7453,7588,8783,6552,7802,7935,8385,8094,93 01,8604,10955,2185,2589,2730,3407,2926,3714,3540,4340,3008,3582,4022,4478,3816,4608,4776,5418,3192,3898, 3747,4736,4035,5047,4566,5588,4206,4817,5104,5662,4924,6128,5985,7269,3274,4081,3939,5268,4424,4786,494 0,5675,4173,5004,5181,6384,5343,5851,6061,6809,4525,5417,5233,6172,5632,6019,6391,7001,5513,6320,6478,70 99,6639,7334,7659,8332,3429,4682,4139,5075,4330, 5444,5202,6208,4567,5314,5601,6099,5672,6334,6508,7228,4 838,5861,5520,6781,5383,6386,6463,7591,6093,6611,6829,7380,7003,7511,7807,8927,4982,5936,5670,6543,6151, 6742,7119,7787,6362,7262,6795,7632,6964,8135,7976,8739,5820,7046,7452,8023,7278,7878,8446,8704,7547,839 4,8197,9216,8655,9019,9441,11106,3724,4362,4752, 5403,4910,5554,6014,6580,5072,6234,5629,6703,5849,6440,7 006,7775,4600,5744,5911,6962,6192,7335,6792,7713,6439,7181,7268,8114,6610,8415,7962,9894,5271,6049,6332, 7502,6583,7218,7079,8328,6150,7308,7649,8012,7533,8178,8569,9081,6887,7593,7438,8215,7786,8827,8435,923 1,7977,8606,8970,9519,8757,9410,10085,10513,5436,6387,6671,7293,6235,7799,7473,8384,6999,7510,8071,8500, 7648,8654,8992,9626,6506,7879,7743,8689,8129,9042,8781,9594,8410,8862,9326,9489,9215,10183,9978, 10702,7 183,8239,8000,9015,8523,9698,8920,9835,7803,9356,9175,10030,9222,10153,10385,12065,8209,9631,9525,10568 ,9433,10356,10628,11236,9817,10595,10453,11481,10823,12573,11300,13025,2535,2853,3068,3777,3250,3869,40 23,4778,3398,4335,3955,5128,4168,4888,5256,6010, 3560,4063,4513,4972,4283,5541,5090,6127,4609,5380,5671,6 764,5319,6217,6378,7382,3664,4466,4343,5206,4708,5371,5642,6412,4975,5863,5455,6294,5844,6525,6983,7617, 4819,5742,5617,6504,6018,6810,6642,7531,6175,6963,7180,8601,7240,8002,7806,9014,3904,4556,4926,5540,520 5,5650,6328,6609,4759,5796,6058,6780,5850,7053,6797,7756,5170,6148,6233,7331,5924,6982,7264,8070,6559,74 17,7021,7903,7590,8208,8433,9397,5512,6308,6670, 7185,6450,7503,7381,8307,6878,7796,7633,8179,7330,8447,8 623,9322,6397,7851,7740,8501,8115,8863,8712,9595,7569,8691,8998,10159,9214,9959,9780,10973,4187, 5257,48 78,6017,5054,6638,5877,7241,5600,6126,6415,7203, 6346,7018,7494,8333,5488,6896,6479,7658,6307,7407,7311,8 465,6794,7575,7931,8211,7795,8674,8802,9545,5842,6585,7000,7528,7123,8022,7772,8954,6615,7712,8242,8738, 7902,8607,9171,9699,7242,8182,8017,8831,8473,9358,9008,9865,8429,9208,9566,10026,9432,10228,10376,11649 ,6171,7276,6798,7983,7015,7804,8232,9036, 7383,8650,8162,8975,8387,9221,9327,10096,7568,8502,8329,9411,88 30,9272,9627,10700,8696,9809,9442,10182,9728,10452,10603,11220,7742,8355,8921,9544,8622,9614,9834,10389 ,9189,10152,9668,10594,10027,10653,10875,11453,9018,9870,10156,11107,10384,10800,10954,11879,9758,1099 1,11238,11710,11301,11963,12222,13248,4640,5375, 5201,6459,5654,6623,6385,7475,5852,6290,7020,8064,6811, 7592,7829,8697,6033,6980,6747,7696,7309,8434,7797,8857,7229,7963,8183,9220,8354,8999,9443,10158, 6329,73 54,7182,8001,7532,8134,8210,9037,6994,8306,8568, 9488,8780,9393,9300,10341,7724,8575,8926,9245,8705,9567, 9729,10554,8464,9820,9550,10391,9982,10675,10822,11669,6582,7098,7774,8522,7495,8411,8843,9517, 8016,912 9,8675,9396,7980,9630,9759,10575,8166,8782,8971, 10179,9188,9669,9914,11134,9357,10140,9821,10652,10359, 10801,11084,11749,8395,8996,9518,9915,9217,10402,10141,10887,9655,10031,10555,10969,10225,11435,11162, 11894,9415,10390,10629,11221,10804,11542,11418, 12157,10602,11261,11711,12333,11668,12037,12439,13293,7 202,7616,7850,8826,8302,9323,8713,9816,8133,9009,8993,10097,9230,10340,9983,11023,8478,9561,9209,9958,9 661,10157,10569,10968,9516,10403,10611,11163,10377,11296,11487,12156,8688,9392,9864,10357,9615,10674,1
0512,11239,9735,10574,10703,11761,10990,11419,11452,12332,10115,10923,11109,11486,10874,11895,11670,12
292,10692,11689,12036,12691,11885,12438,12673,13837,9080,9808,9979,10922,10358,10610,11108,11543,10178 ,10701,10972,11671,11237,12032,11878,12449,10515,11085,11260,11962,11434,11748,12135,12859,11480,12171,
12064,12672,12293,12839,12993,14340,10805,11297,11648,12134,11688,12170,12397,12838,11884,12396,12223,
13076,12572,13077,12992,13836,12033,12448,12690,13090,12858,13091,13249,13495,13024,13292,13494,13677,
13676,14341,13878,13879,1454,1455,1856,2035,1857,2164,2331,2800,1938,2330,2423,2914,2542,3071,3073,3883 ,1939,2422,2532,3070,2619,3198,3367,3957,2768,3366,3248,4032,3529,4148,4240,4988,2034,2543,2663,3218,276
9,3341,3443,4110,2915,3487,3589,4149,3840,4322,4390,5152,3072,3619,3843,4376,3956,4477,4603,5187,4017,46
53,4788,5453,4821,5592,5740,6541,2165,2618,2884,3486,2994,3588,3799,4281,3110,3882,3640,4391,3970,4553,4
740,5316,3340,3842,4016,4652,4118,4755,4820,5523,4170,4837,4990,5652,5134,5822,5909,6766,3451,4033,4150,
4805,4323,4894,5038,5761,4449,5039,5186,5881,5340,6035,6131,6993,4655,5312,5490,6101,5552,6146,6319,717
8,5669,6377,6481,7289,6612,7488,7619,8621,2533,2801,2995,3841,3199,3913,3966,4711,3392,3971,4119,4804,41
71,4892,4919,5746,3528,4130,4241,4895,4377,5037,5175,5898,4552,5182,5313,6008,5522,6124,6310,7077,3726,4
300,4476,5131,4564,5183,5345,6109,4789,5482,5553,6164,5668,6361,6457,7288,4918,5634,5798,6395,5882,6587,
6620,7437,6063,6700,6904,7572,7023,7726,8014,8637,3769,4532,4754,5384,4877,5543,5661,6389,4989,5720,583
3,6540,5926,6613,6761,7515,5173,5899,6009,6691,6147,6830,7013,7770,6292,7048,7217,7892,7321,8066,8164,90
39,5344,6110,6218,6926,6436,7076,7231,7967,6595,7281,7454,8124,7586,8180,8458,9316,6751,7498,7634,8323,7
703,8525,8677,9493,8005,8715,8859,9468,8985,9663,9893,10774,2662,3111,3219,4111,3393,4131,4290,5036,344
2,4291,4398,5153,4594,5317,5385,6304,3641,4399,4595,5438,4762,5491,5626,6305,4836,5621,5741,6480,5904,65
94,6668,7436,3739,4741,4850,5452,4995,5635,5799,6592,5051,5847,5927,6688,6034,6825,6966,7700,5050,6012,6
114,6824,6259,7016,7097,7893,6442,7261,7328,8047,7496,8160,8352,9243,3912,4981,5034,5835,5172,5950,6111,
6767,5224,6130,6210,6997,6322,7146,7271,8045,5721,6311,6437,7201,6554,7295,7493,8126,6711,7508,7650,832
0,7785,8520,8698,9450,5949,6483,6689,7405,6801,7571,7698,8460,6979,7758,7822,8620,8015,8778,8918,9613,72
24,8007,8067,8860,8127,8987,8824,9731,8413,9213,9317,9956,9325,10301,10411,10921,3967,5168,5174,6258,56
40,6360,6456,7260,5846,6477,6555,7352,6710,7512,7639,8462,5938,6698,6800,7513,6924,7699,7793,8648,7049,7
831,7966,8754,8125,8903,9023,9757,6293,6826,6961,7792,7096,7929,8093,8828,7332,8112,8176,9017,8430,8973,
9277,10008,7563,8278,8474,9219,8649,9324,9465,10138,8779,9471,9470,10387,9733,10465,10613,11256,6482,70
44,7266,8113,7509,8177,8335,9131,7651,8461,8527,9318,8708,9395,9469,10245,7800,8673,8840,9451,8924,9491,
9753,10467,9083,9812,9885,10627,10098,10811,10910,11665,8046,8900,9011,9755,9275,9782,10044,10672,9302,
10024,10154,10855,10352,10987,11188,11892,9399,10316,10431,11059,10596,11218,11132,11949,10771,11373,1
1482,12204,11690,12334,12509,12995,2885,3249,3450,4151,3618,4448,4602,5368,3738,4654,4763,5433,4876,560
3,5627,6578,3768,4851,4980,5602,5035,5951,6094,6750,5258,6100,6253,6992,6344,7117,7267,8122,3798,4994,51
69,6013,5266,6219,6316,7054,5369,6388,6460,7282,6586,7489,7560,8198,5483,6510,6637,7500,6782,7638,7727,8
438,6876,7701,7849,8672,7876,8752,8901,9919,4301,5259,5341,6323,5439,6461,6579,7404,5653,6669,6744,7608,
6885,7768,7830,8466,5834,6749,6960,7716,7051,7874,7895,8700,7200,7901,7964,8917,8276,8988,9187,10010,59
39,7050,7144,7960,7294,8069,8121,8939,7492,8275,8393,9082,8572,9246,9319,10177,7595,8457,8652,9321,8800,
9448,9629,10355,8995,9652,9814,10516,9886,10649,10820,11650,4368,5401,5620,6621,5832,6745,6905,7784,590
8,6967,7055,7928,7225,7979,8019,8936,6125,7145,7291,8021,7491,8240,8331,9068,7587,8436,8570,9294,8701,94
08,9549,10200,6317,7353,7535,8353,7752,8475,8467,9413,7801,8676,8736,9494,8953,9649,9671,10553,7978,8801,8991,9664,9069,9833,9892,10676,9212,9980,10111,10872,10383,11025,11191,11925,6448,7618,7759,8678,7894 ,8777,8969,9653,8235,8994,9148,9867,9168,9916,10083,10809,8279,9150,9211,10029,9445,10110,10336,10984,9610,10380,10429,11060,10609,11298,11420,11966,8437,9467,9538,10203,9702,10401,10464,11169,9815,10601,10679,11370,10821,11496,11683,12221,10117,10695,10885,11503,11056,11704,11763,12451,11171,11881,11947,12559,12111,12734,12907,13454,4565,5660,5880,6978,6115,7121,7283,8131,6168,7320,7499,8273,7609,8408,8639 ,9563,6394,7561,7771,8463,7865,8759,8703,9612,7932,8841,8984,9811,9144,9851,9954,10772,6783,7820,7933,8755,8234,8938,9012,9884,8272,9147,9185,9955,9274,10086,10137,10927,8300,9240,9354,10119,9608,10319,10425 ,11063,9666,10573,10608,11321,10694,11421,11557,12173,6884,8213,8237,9070,8305,9151,9293,10106,8456,9446,9527,10247,9650,10408,10598,11223,8990,9565,9730,10427,9819,10630,10697,11375,10099,10768,10906,1154 1, 11058,11692,11727,12437,9184,9832,10028,10648,10118,10852,10956,11615,10342,11021,11086,11724,11219,11883,11964,12653,10454,11186,11354,11946,11455,12078,12172,12750,11654,12207,12329,12890,12390,13063,13088,13859,6927,8321,8399,9547,8937,9625,9670,10571,9021,9783,9855,10655,10080,10803,10925,11559,9191,9952,10113,10813,10231,10959,11105,11709,10410,11216,11081,11873,11416,11951,12110,12677,9611,10139,10318,11027,10519,11160,11323,11942,10625,11355,11454,12079,11555,12129,12257,12869,10848,11499,11680,12201,11841,12354,12399,13035,11890,12554,12650,13182, 12735, 13268, 13288, 13678,9822, 10337, 10614, 11368, 10775,11448,11500,12158,10911,11687,11706,12290,11875,12355,12575,13078,10953,11847,11944,12552,12108,12654,12675,13270,12217,12832,12865,13343,13028,13490,13587,14041,11234,12070,12104,12730,12262,12834,12904,13397,12388,13034,13056,13550,13211,13588,13861,14182,12505,13179,13265,13736,13394,13741,13892,14331,13447,13992,14022,14434,14124,14518,14559,14918,4710,4369,3727,5905,4280,5747,5130,7230,4533,5135,5267,6898,5432,6376,6165,7570,4893,5400,5593,6252,5760,6690,6476,7961,6062,6556,6760,7455,6996,8241,7754,8923,4991,5641,5823,6593,6095,6701,7017,7635,6169,7147,6831,8636,7333,7821,8006,9917,6345,7045,7501,7875,7280,8120,8445,9435,7610,8398,8236,9016,8699,9564,9169,10678,5225,5948,6108,6925,6318,7116,7419,8020,6511,7715,7179,8165,7562,8301,8524,9210,6699,7329,7867,8439,7755,8916,8392,9303,7514,8571,8986,9466,8758,10104,9662,11372,6877,7864,7611,8709,8181,8638,9040,9537,8004,9241,8858,9848,9013,9701,10572,10300,8322,9130,9279,10155,9434,9868,10009,10810,9539,10381,10109,11187,10517,11840,10985,12432,5542,6211,6449,7290,6636,7497,7714,8459,6827,8044,7573,8602,7823,8706,8952,9754,7012,7753,8199,8753,7965,9186,8861,9667,8304,9020,9355,9887,9247,10046,10339,10904,7216,8130,7877,8972,8526,9145,9409,9977,8444,9593,9190,10600,9495,10142,10201,11082,8714,9352,9810,10338,9651,10407,10668,11886,9957,10770,10556,11167,10924,11423,11556,12620,7490,8274,8653,9295,8412,9444,9697,10379,8825,9852,9526,10851,10011,10428,10651,11320,8989,9628,10047,10592,10246,10698,11062,11451,9813,10971,10802,11708,11184,11664,11948,12862,9149,10116,10353,10989,9866,10873,11111,12069,10455,11262,11437,11726,10920,12205,11893,13696,10612,11371,11540,12159, 11667,11961,12128,13061,11190,12294,12391,12729,12508,13399,12906,14439,5883,6557,6748,7717,7022,8068, 7848,8922,7120,7900,8476,9038,8212,9228,9394,10108,7418,8330,8123,9292,8521,9665,9172,10244,8776,9447,9752,10400,9546,10808,10631,11877,7594,8603,8409,9918,9010,9412,9562,10409,8707,9648,9823,11028,10025,10559,10699,11483,9071,10107,9869,10850,10354,10671,11057,11653,10181,10970,11164,11695,11303,11922,1217 5,12692,7769,9276,8679,9703,8902,10136,9850, 10884,9173,9976, 10303, 10773, 10406, 10988, 11170, 11842,9464, 10593,10202,11433,10087,11030,11161,12131,10769,11259,11497,11926,11655,12067,12331,13177,9624,10626,10404,11189,10815,11374,11705,12261,11024,11872,11439,12154,11554,12557,12394,13039,10466,11686,11960,12455,11882,12384,12856,13032,12105,12732,12621,13338,12997,13253,13491,14554,8092,8968,9320,10105,9536,10230,10654,11222,9700,10908,10343,11369,10557,1

1104,11666,12259,9218,10426,10615,11552,10854,11923,114
36,12203,11087,11721,11876,12510,11258,12751,12392,13860,9953,10677,10986,12038,11233,11762,11693,1268
8,10814,11888,12169,12450,12077,12616,12889,13267,11501,12133,11950,12651,12260,13073,12837,13393,1239
5,12908,13180,13549,13057,13452,13893,14181,10112,11031,11353,11887,10909,12291,11965,12728,11651,1206
6,12507,12866,12168,12996,13208,13672,11168,12385,12219,13027,12553,13264,13059,13604,12748,13092,1344
2,13545,13337,14021,13874,14334,11723,12655,12434,13251,12871,13700,13094,13839,12295,13444,13289,1389
0,13342,13997,14123,15029,12623,13675,13551,14210,13489,14044,14292,14652,13833,14215,14179,14773,1434
3,15377,14668,15477,6443,6899,7270,8161,7534,8277,8477,9398,7702,8919,8431,9756,8702,9492,9912,10650,78
66,8573,9041,9592,8829,10227,9732,10807,9229,10082,10405,11422,9981,10905,11026,11940,8018,9022,8925,98
54,9278,10045,10378,11080,9609,10597,10143,10952,10552,11185,11613,12153,9449,10424,10317,11166,10670,
11484,11322,12071,10853,11553,11720,12905,11844,12436,12330,13250,8334,9146,9548,10226,9853,10382,1097
4,11257,9353,10430,10696,11432,10558,11691,11449,12220,9818,10812,10907,11921,10624,11612,11874,12506,1
1217,11945,11685,12387,12130,12622,12835,13451,10180,10958,11352,11725,11110,12039,11927,12679,11498,1
2288,12155,12617,11920,12857,12911,13440,11061,12353,12216,12867,12511,13093,13036,13605,12107,13029,1
3212,14017,13336,13873,13740,14515,8737,9913,9490,10669,9696,11302,10599,11845,10302,10806,11083,11751 ,11020,11682,12034,12693,10176,11502,11165,12174,10957,11943,11891,12861,11438,12109,12389,12649,12263,
12998,13062,13585,10518,11235,11652,12068,11707,12454,12256,13178,11263,12202,12674,13038,12386,12909,
13271,13701,11846,12618,12453,13075,12863,13446,13214,13857,12833,13294,13590,13888,13488,14040,14120,
14803,10849,11880,11450,12433,11681,12328,12652,13254,11941,12994,12558,13183,12731,13341,13443,13894,
12106,12868,12689,13453,13074,13396,13673,14332,13030,13743,13492,14020,13702,14178,14289,14650,12218,
12695,13095,13584,12910,13606,13838,14125,13291,13996,13698,14214,13889,14295,14433,14771,13252,13858,
13998,14555,14122,14336,14438,14937,13738,14517,14654,14914,14669,14943,15108,15546,9242,10081,9849,11
133,10386,11299,11029,11967,10570,10926,11684,12504,11485,12132,12335,13031,10673,11558,11417,12200,11
889,12836,12289,13089,11843,12393,12619,13340,12694,13213,13493,14016,10975,11924,11722,12435,12076,12
556,12648,13255,11614,12678,12888,13544,13058,13449,13398,14043,12206,12891,13176,13395,13033,13591,13
703,14208,12860,13834,13586,14127,13876,14329,14342,14805,11232,11694,12258,12870,12035,12749,13079,13
547,12452,13269,12999,13450,12398,13674,13739,14213,12574,13060,13181,14019,13290,13699,13862,14558,13
445,13994,13835,14294,14047,14337,14552,14917,12733,13210,13548,13863,13339,14176,13995,14435,13679,13
891,14209,14513,14023,14769,14648,14940,13455,14126,14293,14651,14338,14800,14670,15105,14288,14665,14
915,15273,14804,15027,15277,15549,11750,12152,12352,13072,12676,13441,13037,13832,12555,13215,13209,13
895,13392,14042,13877,14519,12864,13589,13295,13872,13697,13999,14211,14512,13546,14177,14291,14649,14
121,14666,14775,15104,13026,13448,13856,14045,13607,14328,14180,14655,13737,14212,14335,14919,14516,14
671,14770,15272,13993,14437,14557,14774,14432,14941,14806,15110,14330,14913,15026,15381,14939,15276,15
379,15859,13266,13742,13875,14436,14046,14290,14556,14801,14018,14333,14514,14807,14653,15024,14936,15
279,14183,14553,14664,14942,14768,14916,15031,15473,14772,15107,15028,15378,15111,15383,15475,15862,14
339,14667,14802,15030,14912,15106,15275,15382,14938,15274,15109,15478,15376,15479,15474,15858,15025,15
278,15380,15544,15472,15545,15547,15551,15476,15548,15550,15857,15856,15863,15860,15861,520,521,522,52
7,523,832,835,1000,524,834,837,1004,904,1105,1107,1581,525,836,838,1104,907,1110,1279,1609,910,1278,1274,
1712,1441,1728,1734,2256,526,905,909,1272,911,1277,1355,1714,1005,1359,1443,1729,1576,1830,1868,2362,110
6,1445,1579,1866,1608,1947,2047,2389,1615,2049,2

092,2545,2169,2646,2792,3345,833,906,1002,1358,1
006,1442 ,1471,1825,1108,1580,1446,1869,1612,195
1,2054,2494,1276,1578,1614,2048,1716,2089,2168,2
641,1732,2171,225
8,2708,2360,2832,2931,3520,1357,1713,1730,2095,1
831,2202,2338,2797,1945,2339,2388,2891,2506,2985
,3089,37
05,2051,2492,2550,2991,2644,3092,3173,3830,2777,
3205,3323,3951,3384,4052,4215,5031,839,1001,1007
,1577,11
11,1583,1610,2053,1352,1613,1717,2094,1733,2200,
2205,2794,1440,1718,1735,2203,1867,2337,2385,289
4,1950,2
386,2493,2940,2640,3046,3168,3765,1464,1828,1946
,2343,2040,2387,2509,3041,2093,2548,2645,3094,27
76,3203,
3309,3950,2204,2686,2798,3289,2892,3353,3386,403
1,2987,3492,3650,4178,3731,4276,4506,5061,1469,1
948,208
8,2520,2175,2643,2711,3207,2257,2778,2835,3344,2
932,3385,3519,4127,2367,2895,2941,3477,3093,3550
,3709,43
14,3130,3734,3875,4442,3991,4540,4678,5463,2508,
3042,3116,3654,3290,3764,3879,4495,3357,3947,404
8,4660,4
180,4690,4934,5712,3517,4094,4224,4825,4255,5009
,5125,5865,4501,5193,5279,5824,5395,6029,6279,71
54,908,1
109,1273,1715,1353,1719,1826,2336,1354,1827,1870
,2363,2044,2495,2521,3132,1447,1871,2045,2526,20
90,2551,
2684,3133,2170,2683,2793,3322,2928,3356,3472,403
0,1467,2055,2172,2544,2261,2687,2799,3354,2341,2
839,293
3,3474,2984,3547,3690,4252,2340,2942,3044,3546,3
129,3728,3767,4443,3294,3929,3992,4539,4092,4676
,4830,56
13,1582,2207,2262,2837,2366,2938,3043,3521,2390,
3088,3114,3707,3174,3828,3933,4537,2779,3169,329
1,3873,3
346,3989,4089,4662,3495,4122,4230,4770,4317,4966
,5148,5790,2937,3325,3475,3999,3527,4177,4250,49
44,3695,
4306,4418,5030,4507,5216,5322,5979,3876,4503,454
1,5296,4663,5397,5222,6081,4885,5577,5713,6338,5
733,665
1,6791,7345,1611,2364,2384,3128,2704,3202,3308,3
928,2838,3321,3347,3996,3494,4124,4229,4946,2934
,3478,35
26,4125,3652,4251,4345,5080,3735,4423,4494,5198,
4661,5303,5459,6153,3131,3548,3689,4344,3766,446
1,4621,5
250,3994,4632,4688,5431,4886,5363,5687,6372,4167
,4730,4960,5581,5081,5732,5811,6534,5217,5827,58
26,6755,
6083,6847,6971,7704,3324,3732,3930,4633,4123,468
9,4829,5499,4231,4945,5011,5714,5166,5757,5825,6
629,434

8,5121,5272,5791,5326,5831,6137,6857,5479,6182,6
275,6989,6470,7193,7342,8109,4538,5300,5425,6139
,5685,61
56,6426,7080,5710,6402,6560,7237,6718,7397,7646,
8422,5759,6680,6837,7461,6934,7676,7554,8519,714
1,7857,7
944,8810,8184,8928,9167,9747,1003,1275,1356,1731
,1444,1944,2046,2510,1466,2050,2091,2525,2174,26
81,2685,
3350,1468,2173,2206,2680,2263,2939,2988,3516,248
8,2990,3119,3704,3200,3809,3931,4658,1470,2260,2
365,294
3,2490,3117,3170,3762,2511,3206,3310,3948,3352,4
053,4164,4692,2549,3326,3389,4120,3522,4228,4277
,4900,36
32,4253,4433,5120,4440,5196,5301,6301,1829,2489,
2507,3175,2527,3311,3351,3998,2709,3473,3512,420
8,3635,4
312,4422,4950,2836,3515,3688,4274,3761,4438,4457
,5150,3872,4459,4492,5321,4728,5398,5571,6374,29
35,3760,
3826,4490,3988,4543,4657,5355,4088,4719,4843,547
8,5014,5614,5715,6565,4183,4933,5084,5729,5218,5
786,599
7,6721,5413,6004,6202,6888,6276,7031,7210,8082,1
864,2523,2682,3387,2834,3513,3651,4316,2930,3691
,3763,44
60,3877,4497,4509,5352,3047,3827,3985,4511,4055,
4702,4827,5474,4181,4898,5012,5706,5151,5768,595
5,6570,3
171,3997,4163,4831,4278,4961,4951,5771,4349,5124
,5194,5866,5357,6001,6045,6893,4496,5219,5409,60
30,5475,
6241,6278,7088,5576,6358,6515,7238,6735,7415,766
9,8483,3304,4214,4307,5126,4456,5215,5359,6005,4
699,541
2,5530,6271,5534,6296,6465,7173,4731,5532,5575,6
407,5783,6514,6686,7394,5976,6732,6835,7464,6949
,7730,79
06,8562,4899,5813,5928,6573,6066,6759,6846,7607,
6203,6939,7091,7812,7211,7952,8147,8849,6529,710
5,7253,7
985,7458,8218,8291,9113,7625,8377,8517,9263,8669
,9484,9693,10478,2041,2710,2890,3694,3045,3825,3
949,467
5,3112,3990,4095,4717,4209,4882,5063,5957,3288,4
165,4315,4947,4435,5213,5161,5978,4462,5273,5394
,6181,55
10,6247,6336,7142,3523,4416,4463,5199,4698,5354,
5426,6274,4716,5529,5569,6337,5684,6466,6533,736
3,4732,5
610,5752,6531,5974,6683,6819,7467,6040,6919,6948
,7745,7104,7907,8053,8773,3634,4697,4701,5476,47
69,5533,
5705,6496,4932,5784,5917,6631,6002,6774,6936,768
1,5408,5959,6080,6821,6207,7028,7107,7859,6471,7
136,731
2,7991,7460,8202,8263,9103,5568,6240,6406,7030,6

530,7234,7370,8079,6716,7411,7522,8260,7677,8379,8560,93 61,6844,7630,7780,8516,7939,8628,8772,9506,8106,8813,8893,9682,9054,9907,9940,10951,3655,4771,4881,5953, 5353,5983,6044,6917,5457,6157,6267,7063,6430,7165,7361,8061,5573,6302,6517,7197,6627,7373,7525,8253,679 0,7674,7481,8363,7862,8535,8668,9387,5977,6535,6682,7431,6891,7558,7747,8506,6985,7781,7938,8629,8049,86 81,8869,9635,7214,7971,8142,8789,8315,8964,9093,9827,8418,9236,9338,10038,9485,10172,10218,10742,6228,6 687,6974,7810,7155,7924,7974,8748,7343,8171,8222,8886,8365,8965,9267,9934,7367,8339,8508,9204,8666,9366, 9371,10214,8821,9552,9623,10275,9790,10500,10623,11253,7684,8614,8630,9458,8882,9556,9684,10321,9050,98 26,9872,10560,10065,10636,10983,11490,9153,10007,10131,10790,10288,10841,11116,11673,10435,11158,11248, 11850,11392,12014,12103,12656,2052,1865,1465,2929,1824,2795,2342,3878,1949,2361,2491,3648,2524,3204,309 5,4176,2201,2522,2647,3118,2796,3476,3320,4491,2986,3348,3518,4049,3706,4703,4304,5325,2259,2705,2833,33 55,2989,3493,3729,4225,3113,3829,3551,5060,3995,4417,4502,6297,3201,3733,4121,4439,3946,4656,4929,5775,4 210,4880,4700,5430,5149,5958,5535,7090,2391,2936,3040,3653,3172,3808,4029,4510,3327,4273,3831,4679,4166, 4733,5008,5574,3479,3993,4437,4901,4305,5320,4842,5711,4126,5013,5396,5812,5212,6490,6028,7856,3633,443 4,4211,5167,4691,5062,5472,5919,4500,5611,5278,6244,5427,6065,6918,6650,4824,5498,5689,6561,5774,6272,63 73,7192,5929,6733,6499,7631,6889,8314,7395,9094,2642,3115,3305,3984,3388,4093,4272,4935,3549,4536,4179,5 028,4419,5164,5356,6138,3708,4279,4693,5197,4493,5570,5297,6041,4768,5456,5753,6277,5615,6428,6713,7300, 3874,4674,4441,5362,5010,5511,5769,6355,4928,5973,5572,6938,5867,6550,6571,7482,5192,5734,6180,6712,600 3,6773,7064,8404,6339,7140,6912,7605,7360,7909,8052,9328,4054,4718,5085,5707,4884,5782,6047,6731,5223,62 64,5916,7233,6375,6834,7059,7744,5399,5996,6429,6932,6630,7108,7466,7927,6183,7389,7164,8252,7628,8108,8 518,9616,5531,6528,6719,7399,6270,7239,7543,8613,6845,7710,7921,8262,7344,8811,8423,10748,6970,7813,799 0,8749,8111,8553,8680,9903,7668,8890,9055,9457,9166,10349,9692,11935,2893,3349,3514,4275,3730,4542,4432, 5324,3824,4458,4962,5462,4696,5608,5756,6498,4028,4826,4659,5704,4967,6031,5562,6628,5214,5785,6136,675 8,5952,7172,7029,8369,4182,5029,4883,6300,5424,5770,5956,6775,5165,6000,6229,7444,6403,6915,7109,7945,54 77,6497,6273,7232,6720,7067,7459,8105,6569,7388,7582,8207,7735,8454,8775,9416,4313,5686,5127,6067,5302,6 532,6246,7252,5563,6354,6653,7143,6772,7398,7624,8316,5810,6933,6572,7917,6467,7446,7559,8683,7137,7707, 7953,8488,8107,8599,8895,9995,5982,6988,6770,7647,7199,7858,8219,8875,7414,8362,7923,8744,8048,9239,908 8,9843,6856,8170,8552,9123,8378,8978,9582,9804,8631,9478,9329,10268,9763,10091,10501,12082,4620,5358,57 28,6491,5918,6626,7062,7680,6064,7314,6717,7811,6913,7524,8110,8871,5580,6820,6975,8030,7236,8455,7920,8 797,7523,8257,8368,9182,7706,9507,9062,10982,6303,7089,7396,8590,7683,8290,8203,9404,7198,8416,8765,911 2,8625,9286,9673,10165,7975,8685,8534,9339,8874,9923,9559,10283,9089,9694,10022,10551,9873,10474,11117, 11489,6516,7447,7763,8405,7315,8887,8561,9456,8083,8598,9159,9632,8764,9762,10060,10722,7606,8979,8823, 9789,9205,10130,9901,10662,9498,9946,10374,10537,10259,11231,11038,11730,8259,9367,9100,10079,9639,107 62,9988,10931,8891,10432,10219,11070,10274,11201,11389,12941,9333,10731,10561,11532,10485,11344,11620, 12232,10893,11563,11465,12417,11819,13389,12272,13765,3295,3649,3932,4677,4162,4729,4963,5758,4254,532 3,4887,6152,5160,5864,6284,7058,4436,5015,5473,5972,5251,6601,6082,7171,5609,6464,6771,7908,6359,7301,74 30,8490,4508,5458,5327,6266,5688,6427,6730,7480,5975,6935,6551,7366,6892,7629,8063,8733,5787,6818,6681,7 604,7066,7946,7746,8615,7235,8031,8256,9685,8336,9102,8894,10078,4828,5528,5954,6600,6265,6734,7392,770 5,5735,6836,7106,7916,6914,8185,7925,8848,6206,7196,7313,8451,6984,8062,8364,9158,7675,8509,8149,9031,86 82,9332,9557,10457,6568,7372,7762,8261,7542,8591,8489,9391,7970,8884,8745,9287,8450,9583,9715,10370,746 5,8947,8820,9633,9183,9947,9828,10663,8657,9791, 10066,11211,10258,11015,10840,11993,5195,6285,5 830,7065 ,6046,7734,6937,8337,6652,7170,7483,827 1,7410,8146,8582,9417,6564,7984,7583,8774,7371,8 507,8419,9601,792
2,8667,9051,9335,8883,9770,9906,10585,6890,7685, 8104,8612,8223,9122,8868,10006,7711,8796,9370,98 42,9030,
9695,10215,10763,8338,9306,9117,9927,9617,10434, 10072,10945,9553,10252,10642,11066,10484,11252, 11348,1
2501,7215,8376,7926,9095,8143,8892,9360,10124,84 91,9746,9262,10039,9459,10273,10375,11124,8656,9 634,940
5,10475,9926,10320,10723,11728,9796,10861,10502, 11230,10780,11464,11579,12212,8822,9423,9989,10 584,971
4,10714,10930,11393,10237,11200,10756,11562,110 67,11629,11831,12413,10090,10950,11208,12083,11 388,1178
0,11934,12743,10830,12007,12234,12614,12273,128 55,13134,13960,5612,6431,6245,7555,6754,7731,744 5,8563,6
916,7362,8148,9152,7947,8684,8929,9797,7081,8060 ,7863,8788,8417,9558,8885,9941,8317,9063,9307,10 272,942
2,10067,10503,11210,7393,8482,8258,9101,8624,923 8,9334,10125,8078,9390,9672,10536,9900,10445,103 48,1133
3,8812,9683,9994,10289,9805,10643,10781,11506,96 00,10900,10622,11395,11042,11643,11818,12541,76 82,8206,
8870,9638,8583,9499,9935,10549,9116,10173,9771,1 0456,9092,10730,10831,11547,9266,9902,10023,112 15,1023
6,10757,10998,12102,10433,11196,10901,11628,113 47,11781,12060,12645,9479,10064,10550,10999,102 69,11402 ,11197,11851,10743,11071,11507,11985,11 249,12367,12142,12794,10479,11394,11621,12213,1 1788,12470,12350,
13017,11578,12253,12615,13185,12540,12933,13311 ,14053,8270,8732,8946,9922,9386,10371,9829,10892 ,9237,1
0073,10061,11125,10282,11332,11043,12015,9622,1 0637,10253,11014,10749,11209,11533,11984,10548, 11403,11
595,12143,11349,12264,12427,13016,9788,10444,10 944,11345,10715,11642,11488,12235,10791,11546,1 1731,126
57,12006,12351,12412,13184,11159,11907,12093,12 426,11830,12795,12542,13164,11672,12585,12932,1 3499,127
65,13310,13469,14445,10164,10860,11039,11906,11 346,11594,12092,12471,11214,11729,11992,12543,1 2233,128
96,12742,13313,11491,12061,12252,12854,12366,12 644,12991,13615,12416,13043,12940,13468,13165,1 3583,137

21,14928,11789,12265,12500,12990,12584,13042,13 273,13582,12764,13272,13135,13840,13388,13841,1 3720,144
44,12897,13312,13498,13850,13614,13851,13961,14 219,13764,14052,14218,14349,14348,14929,14526,1 4527,204
2,2043,2504,2707,2505,2888,3091,3544,2546,3090,3 135,3710,3306,3935,3945,4735,2547,3134,3292,3934 ,3359,40
50,4227,4897,3524,4226,4160,4964,4421,5144,5220, 5992,2706,3307,3391,4090,3525,4213,4319,5082,371 1,4351,4
489,5145,4712,5298,5410,6200,3944,4499,4715,5392 ,4896,5461,5583,6243,4949,5681,5772,6549,5789,66 48,6816,
7645,2889,3358,3692,4350,3810,4488,4695,5249,398 6,4734,4504,5411,4930,5509,5708,6356,4212,4714,4 948,568
0,5086,5731,5788,6575,5162,5809,5994,6752,6158,6 858,6973,7910,4347,4965,5146,5781,5299,5870,6026 ,6833,54
29,6027,6242,6941,6400,7083,7175,8077,5683,6352, 6566,7153,6624,7194,7387,8254,6769,7429,7601,840 1,7708,8
576,8735,9713,3293,3545,3811,4713,4051,4841,4902 ,5691,4248,4931,5087,5780,5163,5868,5931,6822,44 20,5122,
5221,5871,5393,6025,6227,6950,5508,6230,6353,705 6,6574,7168,7374,8201,4622,5276,5460,6155,5560,6 231,640
5,7161,5773,6562,6625,7208,6768,7413,7553,8400,5 930,6722,6838,7463,6942,7687,7728,8533,7111,7808 ,7988,86
64,8151,8814,9114,9741,4673,5496,5730,6468,5829, 6603,6757,7457,5993,6788,6865,7644,6986,7709,790 5,8611,6
225,6951,7057,7779,7195,7954,8141,8854,7364,8172 ,8289,9000,8421,9154,9264,10127,6404,7162,7302,7 998,752
0,8200,8319,9075,7695,8381,8554,9200,8670,9304,9 586,10364,7883,8586,8746,9403,8795,9641,9773,105 41,9105,
9831,9943,10532,10049,10751,10981,11774,3390,39 87,4091,5083,4249,5123,5274,6024,4318,5275,5414, 6201,557
8,6357,6469,7368,4505,5415,5579,6518,5754,6567,6 714,7369,5808,6685,6817,7600,6968,7694,7760,8532 ,4635,57
09,5814,6548,5999,6723,6839,7692,6043,6895,6987, 7776,7082,7949,8050,8792,6042,7060,7166,7948,734 7,8144,8
205,9001,7526,8361,8448,9143,8584,9260,9420,1028 7,4840,5981,6006,6867,6224,7026,7163,7911,6268,7 174,725
4,8081,7390,8250,8371,9141,6789,7375,7521,8269,7 670,8407,8581,9202,7815,8596,8766,9400,8873,9636 ,9798,10
522,7025,7603,7777,8505,7937,8659,8790,9588,8055,8850,8910,9712,9115,9878,9986,10713,8312,9107,9155,994
4,9203,10051,9920,10783,9505,10257,10365,11012,10373,11293,11411,11905,4903,6204,6226,7346,6728,7412,75
52,8360,6894,7581,7671,8480,7814,8608,8751,9590,6990,7782,7936,8609,7996,8791,8881,9744,8173,8931,9074,9
858,9201,9971,10095,10829,7365,7950,8029,8880,8204,9049,9165,9924,8452,9180,9284,10089,9554,10037,10325 ,11048,8643,9382,9618,10271,9745,10372,10529,11182,9879,10535,10534,11391,10789,11473,11597,12244,7602,
8168,8366,9181,8597,9285,9419,10175,8767,9589,9643,10366,9824,10447,10533,11277,8888,9769,9932,10523,99
92,10539,10793,11475,10167,10868,10965,11607,11126,11799,11870,12529,9142,9968,10075,10795,10323,10842 ,11096,11640,10350,11064,11202,11827,11336,11999,12196,12792,10459,11308,11459,12043,11564,12210,12100,
12841,11743,12337,12418,13116,12586,13186,13357,13723,3693,4161,4346,5147,4498,5428,5582,6424,4634,568
2,5755,6513,5828,6655,6715,7678,4672,5815,5980,6654,6007,7027,7138,7882,6286,7152,7341,8076,7408,8217,83
67,9198,4694,5998,6205,7061,6298,7303,7384,8186,6425,7456,7556,8382,7686,8577,8640,9330,6563,7626,7733,8
588,7918,8750,8815,9574,7968,8793,8945,9768,8976,9856,9969,11003,5277,6287,6401,7391,6519,7557,7679,850
4,6753,7761,7860,8724,7973,8852,8930,9602,6866,7881,8028,8808,8175,8966,9003,9800,8268,9029,9072,9985,93
80,10052,10235,11050,6991,8174,8248,9060,8406,9157,9197,9999,8580,9379,9477,10166,9680,10290,10367,1121
3,8687,9585,9760,10369,9904,10520,10729,11339,10063,10740,10870,11492,10966,11625,11816,12502,5360,648
9,6684,7729,6864,7861,7989,8872,6972,8051,8187,9048,8313,9091,9119,9996,7169,8249,8403,9121,8579,9368,94
07,10148,8671,9572,9674,10334,9801,10472,10621,11240,7385,8481,8627,9421,8836,9619,9603,10477,8889,9772 ,9840,10542,10005,10733,10759,11505,9090,9905,10055,10752,10149,10929,10980,11644,10256,11040,11151,11
828,11379,12021,12199,12801,7540,8734,8851,9774,9002,9877,10021,10741,9363,10062,10208,10947,10212,110 00,
11115,11797,9383,10210,10255,11069,10505,11150,11328,11996,10710,11376,11457,12048,11593,12266,1236
0,12882,9573,10531,10566,11243,10766,11401,11472,12177,10871,11577,11647,12322,11817,12428,125
47,13133 ,11177,11675,11849,12447,12040,12604,12659,13315,12179,12757,12823,13375,12979,13530,13687,14170,5561,
6756,6940,8054,7167,8221,8383,9207,7212,8420,8587,9377,8725,9496,9743,10639,7462,8641,8855,9591,8961,98
75,9803,10712,9052,9933,10048,10863,10188,10939,11010,11772,7919,8908,9053,9859,9362,9998,10076,10964,9
376,10191,10233,11011,10322,11118,11181,11919,9384,10284,10398,11179,10708,11311,11441,12051,10754,1154
5,11592,12277,11674,12361,12485,13081,7972,9337,9365,10150,9389,10211,10333,11142,9584,10506,10563,112
79,10734,11408,11566,12215,10054,10641,10782,11443,10895,11622,11701,12339,11127,11740,11858,12469,120
42,12600,12639,13309,10232,10928,11068,11624,11178,11824,11956,12499,11334,12013,12062,12636,12211,127
59,12880,13457,11466,12186,12302,12822,12415,12962,13080,13542,12514,13119,13169,13662,13258,13815,138
48,14491,7999,9401,9487,10587,9997,10721,10758,11535,10093,10843,10943,11631,11112,11783,11917,12487,10
239,11008,11157,11809,11255,11959,12081,12613,11410,12208,12053,12717,12348,12843,12978,13485,10711,11
183,11310,12023,11495,12140,12279,12814,11605,12303,12414,12963,12479,12985,13137,13653,11820,12431,12
544,13109,12669,13190,13275,13795,12786,13366,13430,13934,13531,14024,14048,14350,10902,11329,11598,12
320,11775,12400,12444,13018,11871,12567,12606,13158,12719,13191,13391,13842,11933,12707,12820,13364,12
976,13458,13471,14026,13129,13568,13645,14083,13784,14198,14259,14633,12230,12954,12972,13522,13146,13
570,13684,14101,13256,13794,13804,14238,13939,14264,14501,14750,13333,13931,13973,14400,14094,14409,14
584,14867,14135,14600,14626,14974,14728,15062,15083,15330,5690,5361,4623,6969,5248,6823,6154,8318,5497,
6159,6299,7986,6512,7428,7209,8658,5869,6488,6649,7340,6832,7778,7580,9061,7110,7672,7904,8555,8080,936
9,8838,9991,5995,6729,6859,7693,7139,7809,8145,8747,7213,8251,7955,9740,8453,8909,9106,11001,7409,8169,8
589,8967,8380,9196,9581,10487,8726,9486,9364,10088,9799,10640,10213,11646,6269,7024,7160,7997,7386,8216 ,8511,9120,7627,8799,8255,9265,8642,9385,9640,10254,7783,8449,8963,9575,8839,9984,9476,10

351,8610,9675,1 0050,10530,9874,11140,10750,12336,7969,8960,872 7,9825,9305,9742,10128,10565,9104,10285,9942,109 36,1007 7,10765,11544,11292,9402,10174,10327,11203,1048 6,10948,11049,11798,10567,11377,11149,12187,114 93,12668, 11997,13296,6602,7255,7541,8402,7732,8585,8798,9 587,7951,9140,8665,9686,8911,9806,10004,10794,81 40,8837 ,9331,9857,9073,10234,9945,10755,9388,10 092,10399,10967,10291,11098,11331,11856,8288,92 06,8977,10036,96 42,10189,10473,11037,9580,10661,10238,11576,105 43,11198,11241,12054,9830,10396,10862,11330,107 35,11407, 11636,12766,11013,11742,11520,12151,11916,12363 ,12484,13416,8578,9378,9761,10335,9504,10504,107 61,1135 1,9921,10940,10562,11823,11051,11456,11627,1227 6,10053,10728,11099,11560,11278,11702,12050,124 03,10869, 11987,11782,12612,12184,12528,12840,13622,10209 ,11176,11337,12005,10946,11829,12095,12953,1146 7,12254, 12373,12638,11904,13117,12793,14372,11596,12323 ,12468,13019,12531,12853,12984,13813,12198,1316 6,13259, 13521,13356,14103,13686,14987,6943,7673,7880,88 09,8150,9156,8944,9990,8220,9028,9620,10126,9336 ,10280,1 0446,11148,8510,9406,9199,10332,9637,10753,1021 6,11276,9876,10507,10792,11400,10586,11796,1162 3,12741, 8686,9687,9497,11002,10074,10476,10638,11409,98 07,10732,10903,12028,11065,11523,11703,12419,10 151,1114 3,10949,11822,11338,11639,12041,12513,11229,119 86,12148,12603,12275,12798,13083,13504,8853,103 24,9775, 10767,9970,11180,10938,11848,10217,11036,11295, 11773,11406,12004,12178,12670,10528,11561,11242 ,12365,1 1119,12030,12141,12987,11741,12247,12429,12802, 12515,12943,13171,13929,10720,11606,11404,12197 ,11811,1 2338,12605,13145,12020,12716,12375,13006,12478, 13373,13262,13803,11474,12566,12852,13327,12758 ,13232,1 3612,13792,12973,13528,13417,14070,13729,13965, 14199,15074,9164,10020,10368,11141,10564,11254, 11630,12 214,10764,11868,11335,12321,11521,12080,12530,1 3139,10270,11442,11599,12476,11826,12799,12372, 13111,12 063,12629,12740,13358,12246,13543,13260,14500,1 1009,11645,11998,12934,12229,12658,12601,13496, 11810,12 784,13041,13314,12961,13400,13661,13975,12445,1 2989,12842,13431,13144,13821,13581,14093,13263, 13692,13 932,14237,13805,14168,14585,14749,11156,12031,1 2301,12767,11869,13159,12881,13520,12503,12942, 13335,13 646,13040,13728,13936,14324,12176,13233,13131,1 3767,13365,13972,13807,14300,13540,13912,14118, 14233,14 069,14625,14506,14894,12631,13459,13298,13963,1 3655,14388,13914,14447,13167,14132,14049,14534, 14082,14 605,14711,15501,13419,14327,14239,14782,14197,1 4692,14844,15148,14429,14819,14739,15241,14931, 15653,15 172,15821,7527,7987,8370,9261,8626,9381,9621,104 58,8794,9987,9555,10828,9802,10540,10996,11626,8 962,968 1,10129,10660,9925,11251,10788,11791,10281,1111 4,11405,12362,11041,11857,12022,12812,9118,1009 4,9993,10 942,10326,11097,11350,12052,10709,11565,11199,1 1932,11504,12185,12497,13005,10521,11440,11309, 12150,11 638,12424,12278,12955,11825,12477,12628,13685,1 2704,13308,13170,13962,9418,10190,10620,11250,1 0941,113 78,11994,12245,10397,11458,11700,12364,11522,12 587,12401,13132,10894,11808,11859,12797,11604,1 2496,127 18,13334,12209,12821,12565,13235,12986,13418,13 571,14155,11228,11958,12300,12637,12094,12935,1 2803,134 87,12430,13156,13007,13401,12796,13613,13695,14 116,12049,13189,13128,13647,13359,13913,13800,1 4301,129 75,13785,13952,14617,14068,14505,14408,15007,98 41,10997,10538,11637,10760,12274,11567,12705,11 294,1179 0,12055,12647,12012,12546,12898,13505,11212,124 46,12149,13082,11957,12815,12787,13621,12374,12 977,1325 7,13429,13147,13730,13814,14257,11494,12231,125 12,12952,12607,13326,13136,13930,12255,13110,13 470,1380 2,13234,13693,14027,14389,12706,13402,13325,138 23,13623,14134,13954,14489,13569,14054,14266,14 532,1419 6,14632,14708,15259,11821,12756,12402,13297,125 45,13168,13456,13966,12813,13722,13374,13935,13 523,1408 1,14119,14586,12974,13652,13497,14169,13822,141 00,14325,14892,13786,14411,14216,14624,14390,14 738,1484 1,15090,13130,13507,13915,14256,13694,14302,144 46,14729,14051,14604,14374,14818,14533,14847,14 973,1521 5,13964,14490,14606,15075,14710,14920,14986,153 85,14402,15061,15150,15326,15173,15427,15568,15

882,1028
6,11113,10937,12101,11390,12267,12029,12883,115 34,11918,12564,13332,12425,12988,13187,13787,11 641,1248
6,12349,13108,12785,13580,13157,13849,12671,132 61,13403,14080,13506,13953,14217,14616,11995,12 800,1263
0,13299,12960,13372,13428,13967,12498,13486,136 60,14232,13806,14153,14102,14635,13118,13663,13 928,1409
5,13793,14267,14391,14780,13620,14430,14258,147 31,14524,14865,14930,15305,12228,12602,13138,13 654,1289
9,13541,13843,14235,13324,14025,13731,14154,132 74,14326,14403,14817,13390,13812,13933,14619,14 050,1437
5,14502,15082,14133,14602,14431,14846,14695,149 21,15072,15329,13529,13938,14236,14503,14071,14 736,1460
3,14975,14351,14535,14781,15005,14627,15213,150 88,15424,14171,14730,14845,15091,14922,15256,15 174,1550
9,14840,15161,15327,15585,15304,15447,15641,159 29,12646,13004,13188,13820,13484,14117,13801,14 428,1336
7,13955,13937,14587,14092,14634,14525,15063,136 44,14265,14055,14504,14373,14607,14783,15004,14 234,1473
7,14843,15089,14709,15162,15243,15508,13766,141 52,14488,14693,14303,14864,14748,15151,14401,14 816,1489
5,15331,15060,15175,15214,15584,14601,14985,150 81,15242,14972,15425,15306,15570,14866,15325,15 446,1569
7,15387,15640,15655,15967,13974,14410,14507,149 84,14694,14842,15080,15257,14618,14893,15006,15 307,1514
9,15444,15384,15643,14751,15073,15160,15426,152 12,15328,15503,15737,15240,15511,15500,15654,15 571,1569
9,15739,16122,14923,15163,15258,15502,15324,155 10,15587,15698,15386,15586,15569,15822,15652,15 823,1573
8,15966,15445,15642,15696,15880,15736,15881,158 83,15931,15820,15928,15930,15965,15964,16123,16 120,1612
1,2780,2781,2782,3491,2783,3636,3639,4444,3488,3 638,3813,4616,4024,4637,4639,5693,3489,3812,3814 ,4636,40
27,4774,5027,5717,4310,5026,4846,5912,5253,5968, 6070,6868,3490,4025,4309,4844,4311,5025,5059,591 4,4617,5
211,5255,5969,5564,6142,6280,7086,4638,5365,5567 ,6178,5716,6343,6503,7133,5779,6545,6660,7425,67 25,7486,
7748,8541,3637,4026,4446,5210,4618,5254,5507,608 5,4772,5692,5366,6281,5776,6371,6606,7250,5024,5 566,577
8,6544,5932,6657,6724,7469,6068,6727,6870,7664,7 084,7832,7943,8816,5209,5913,5970,6663,6143,6842 ,6946,77
65,6341,6947,7132,7887,7298,8057,8153,9025,6547, 7248,7442,8075,7484,8156,8341,9178,7689,8349,853 1,9311,8
644,9460,9647,10547,3815,4445,4619,5565,4775,569 5,5718,6605,5056,5777,5933,6662,6069,6840,6861,7 750,525
2,5934,6071,6843,6179,6945,7129,7914,6370,7130,7 249,8024,7468,8138,8292,9125,5500,6140,6342,7071 ,6492,71
31,7317,8085,6661,7440,7485,8158,7688,8347,8513, 9310,6860,7578,7766,8373,7912,8565,8646,9427,805 9,8760,8
934,9570,9079,9736,10034,10577,5505,6368,6656,73 36,6787,7471,7667,8351,6869,7690,7835,8540,7956, 8645,87
87,9511,7095,7915,8025,8729,8157,8878,9057,9766, 8282,9098,9195,9938,9347,10120,10194,11007,7316, 8086,82
64,8950,8374,9124,9235,9975,8593,9283,9428,10168 ,9576,10198,10462,11272,8785,9482,9676,10329,971 1,10509 ,10633,11425,10017,10705,10799,11396,108 99,11581,11787,12526,4308,4773,4845,5915,5057,59 35,6086,6944,50
58,6087,6282,7087,6500,7251,7337,8284,5367,6283, 6501,7350,6658,7443,7576,8285,6726,7539,7749,853 0,7940,8
592,8720,9426,5503,6607,6784,7424,6929,7579,7767 ,8566,7069,7839,7957,8722,8056,8867,8982,9708,70 68,8026,
8136,8866,8281,9076,9127,9939,8486,9257,9348,100 71,9480,10192,10346,11193,5694,6863,6930,7837,70 94,7994 ,8087,8817,7134,8152,8190,9027,8342,9176, 9269,10069,7691,8293,8375,9193,8542,9345,9473,10 170,8763,9502,9
690,10310,9785,10498,10656,11366,7993,8537,8723, 9375,8835,9569,9706,10480,9007,9750,9862,10546,1 0035,10
736,10838,11515,9232,10019,10121,10824,10171,10 913,10746,11617,10417,11137,11273,11814,11285,1 2091,122
27,12665,5719,7092,7128,8280,7640,8346,8512,9256 ,7838,8529,8543,9372,8762,9508,9689,10482,7958,8 730,883
4,9509,8948,9707,9793,10580,9099,9899,9974,10718 ,10169,10835,10995,11657,8283,8876,8981,9792,912 6,9961,
10133,10778,9350,10144,10196,10979,10418,10891, 11227,11852,9535, 10294, 10492, 11145, 10581, 11284, 11383, 11 982,10737,11399,11398,12167,11619,12283,12379,1 2944,8536,9096,9258,10145,9503,10197,10345,1105 5,9691,1
0481,10511,11274,10686,11305,11397,12085,9844,1 0617,10784,11367,10846,11415,11633,12285,11047, 11678,11 779,12409,11914,12577,12662,13229,10070,10832,1
0961,11635,11225,11660,11898,12472,11270,11862,
12000,12
609,12126,12725,12902,13466,11307,12112,12269,1
2777,12326,12920,12826,13519,12521,13045,13112,
13718,13
284,13796,13959,14275,4447,4847,5208,5971,5364,6
340,6502,7318,5502,6546,6659,7349,6786,7537,7577
,8558,5
504,6785,6862,7536,6931,7995,8072,8784,7156,8074
,8267,9024,8344,9137,9259,10162,5506,6928,7093,8
027,715
8,8265,8294,9110,7319,8350,8514,9308,8564,9461,9
532,10220,7441,8538,8661,9500,8818,9688,9737,104
36,8904,
9709,9909,10616,9936,10716,10833,11805,6141,715
7,7299,8343,7351,8515,8559,9374,7665,8721,8768,9
604,8907 ,9764,9898,10490,7836,8771,8980,9718,91
09,9930,9949,10658,9192,9951,9972,10837,10292,10
914,11103,11854,
7959,9108,9162,9966,9344,10123,10161,10859,9472,
10279,10363,11046,10526,11194,11275,12009,9579,
10461,1
0588,11281,10738,11362,11529,12137,10933,11568,
11698,12304,11784,12443,12590,13222,6176,7339,7
538,8647 ,7834,8769,8935,9784,7942,8983,9111,996
0,9233,10001,10057,10856,8139,9163,9341,10059,94
63,10262,10331,1
1034,9577,10422,10524,11266,10659,11312,11471,1
2018,8295,9373,9531,10347,9738,10493,10491,1131
5,9845,1
0632,10706,11426,10865,11549,11589,12309,10000,
10739,10917,11582,11035,11737,11786,12480,11136
,11838,1
1971,12610,12163,12755,12913,13483,8492,9646,97
51,10634,9948,10727,10867,11569,10251,10932,110
78,11771 ,11090,11800,11909,12561,10295,11088,11
123,11867,11343,11970,12118,12722,11512,12160,1
2251,12780,12369,
12958,13066,13538,10423,11385,11460,12025,11602
,12183,12282,12875,11699,12343,12483,13020,1259
1,13124,
13243,13749,11977,12489,12625,13153,12774,13318
,13371,13917,12877,13421,13517,14003,13633,1414
0,14253,
14686,6493,7666,7886,9006,8137,9161,9309,10187,8
188,9346,9483,10277,9605,10394,10579,11477,8372,
9533,97
67,10483,9911,10725,10681,11514,9962,10785,1089
8,11677,11074,11755,11812,12522,8819,9860,9963,1
0719,10
250,10858,10962,11778,10276,11077,11101,11813,1
1224,11910,11981,12683,10304,11154,11288,11979,
11510,121
15,12239,12783,11584,12319,12368,12969,12488,13
067,13201,13689,8906,10249,10261,11044,10309,11
089,1126
5,11952,10460,11360,11445,12087,11550,12194,123
40,12925,10916,11479,11616,12241,11715,12440,12
491,1304
7,11915,12516,12640,13163,12776,13302,13355,139
07,11100,11736,11866,12442,11978,12598,12698,13
219,1212
4,12739,12806,13352,12921,13423,13536,14057,122
80,12886,13008,13516,13107,13608,13688,14150,13
226,1372
5,13781,14246,13870,14371,14392,14911,8951,1031
1,10393,11469,10857,11519,11588,12317,10993,116
61,11759,
12463,11902,12537,12681,13205,11121,11806,11973
,12581,12059,12701,12809,13345,12226,12918,1278
9,13407,
13050,13527,13632,14087,11513,11983,12114,12763
,12307,12830,12971,13510,12405,13009,13106,1360
9,13197,
13637,13757,14223,12594,13143,13238,13705,13379
,13824,13901,14319,13462,13988,14038,14454,1414
1,14528,
14550,14814,11732,12119,12382,13014,12527,13100
,13150,13668,12663,13279,13322,13774,13409,1382
5,14007,
14386,12687,13387,13512,13984,13630,14062,14067
,14546,13733,14156,14207,14583,14298,14696,1475
9,15069,
12928,13594,13610,14130,13770,14160,14248,14609
,13866,14318,14356,14740,14469,14760,14935,1517
8,13945,
14443,14499,14854,14596,14869,14996,15261,14663
,15018,15064,15334,15132,15390,15431,15648,6604,
6177,55
01,7941,6084,7751,7070,9234,6369,7085,7159,8932,
7348,8348,8159,9568,6841,7338,7487,8266,7764,872
8,8528,9
967,8058,8556,8786,9429,9026,10263,9748,10845,68
71,7641,7833,8567,8073,8761,9077,9677,8189,9177,
8879,10
576,9351,9861,10018,11801,8345,9097,9501,9931,92
82,10160,10441,11319,9606,10392,10260,10978,106
57,1147
8,11091,12482,7135,7992,8084,8949,8340,9136,9425
,10058,8539,9717,9179,10195,9534,10305,10508,111
22,8731 ,9349,9929,10437,9749,10836,10362,11271,
9510,10525,10912,11384,10724,11930,11580,13044,
8905,9910,9607,1
0687,10199,10578,11032,11447,10016,11155,10798,
11752,10963,11601,12318,12090,10328,11054,11245
,12001,1
1318,11776,11853,12576,11461,12161,11955,12887,
12305,13378,12723,13902,7470,8191,8493,9340,866
0,9481,9
716,10463,8877,10068,9571,10544,9863,10684,1086
4,11634,9056,9739,10221,10717,9973,11102,10825,1
1585,10
308,10992,11289,11785,11195,11900,12121,12632,9
194,10186,9937,10890,10510,11075,11313,11835,10
440,1150

9,11120,12342,11427,11990,12019,12790,10704,11286,11676,12120,11551,12193,12464,13436,11815,12520,1231
2,12873,12680,13069,13200,14028,9462,10278,10589,11267,10416,11342,11591,12147,10747,11756,11444,12597 ,11855,12250,12459,12968,10915,11528,11901,12324,12086,12492,12782,13103,11679,12713,12536,13344,12884 ,13228,13518,14200,11079,11976,12127,12727,11770,12611,12819,13593,12281,12950,13097,13354,12664,13719 ,13467,14820,12378,13021,13162,13669,13231,13533,13636,14367,12912,13778,13871,14129,13958,14629,14252 ,15355,7913,8557,8770,9719,9078,10122,9908,10844,9160,9950,10494,11006,10248,11152,11304,11954,9424,103
30,10163,11264,10499,11583,11094,12084,10726,11361,11632,12182,11468,12560,12441,13413,9578,10545,1039
5,11804,10960,11314,11476,12195,10685,11548,11733,12768,11863,12315,12493,13113,11045,11953,11777,1259
6,12136,12467,12775,13225,12017,12712,12846,13307,12967,13478,13691,14108,9765,11226,10635,11603,10834 ,11980,11754,12624,11095,11834,12097,12523,12192,12726,12876,13380,11382,12325,12024,13085,11911,12770,
12831,13639,12517,12947,13125,13500,13227,13575,13783,14423,11518,12408,12190,12903,12583,13046,13319,
13763,12754,13406,13099,13664,13196,13991,13896,14347,12284,13278,13532,13927,13422,13830,14174,14312,
13611,14138,14029,14576,14279,14483,14697,15418,10132,10866,11280,11931,11446,12058,12462,12924,11600,
12642,12125,13015,12313,12808,13230,13759,11144,12240,12383,13194,12608,13479,13096,13713,12807,13349,
13412,13970,12946,14151,13882,14934,11807,12481,12724,13566,12927,13370,13303,14104,12582,13460,13681,
13916,13597,14010,14241,14521,13151,13641,13526,14039,13762,14379,14163,14591,13897,14254,14450,14735,
14357,14682,14997,15177,11972,12771,12983,13437,12643,13775,13537,14128,13223,13574,13951,14220,13680,
14278,14464,14794,12874,13831,13735,14297,13985,14498,14365,14778,14146,14398,14646,14721,14575,15055,
14962,15270,13351,14063,13904,14479,14227,14834,14416,14891,13779,14660,14551,14982,14582,15041,15129,
15729,14033,14799,14741,15192,14689,15116,15228,15468,14881,15203,15165,15553,15311,15885,15492,15985,
8487,8933,9268,10193,9530,10293,10495,11306,9710,10839,10419,11656,10680,11424,11792,12458,9928,10527, 11033,11508,10779,12045,11618,12551,11153,11908,12191,13068,11839,12633,12762,13502,10056,10994,10847,
11758,11244,11899,12146,12788,11511,12327,11991,12686,12308,12885,13207,13657,11363,12238,12113,12872,
12466,13114,12970,13595,12599,13195,13348,14249,13384,13906,13782,14478,10344,11076,11470,12044,11757,
12162,12720,12945,11287,12268,12490,13084,12314,13285,13101,13748,11714,12580,12641,13475,12404,13206,
13408,13950,12919,13513,13245,13855,13638,14032,14161,14677, 120 16, 12700, 12982, 13353, 12818, 13567, 1350 1,
14091,13142,13772,13665,14011,13474,14175,14263,14642,12781,13811,13732,14221,13971,14399,14320,14779,
13625,14299,14470,15047,14574,14959,14868,15365,10707,11793,11414,12465,11590,12966,12341,13385,12096,
12550,12791,13363,12738,13242,13558,14109,12008,13152,12847,13690,12699,13511,13463,14193,13098,13631,
13867,14035,13771,14282,14370,14753,12306,12929,13224,13592,13323,13926,13756,14442,12951,13712,14066,
14346,13854,14255,14547,14835,13386,14014,13921,14383,14201,14662,14472,14905,14157,14568,14766,14978,
14688,15068,15120,15593,12595,13420,13102,13903,13239,13780,14056,14492,13503,14274,14002,14455,14131,
14581,14647,15000,13624,14222,14105,14683,14382,14608,14795,15268,14304,14873,14698,15054,14848,15164,
15211,15460,13734,14115,14417,14752,14262,14790,14890,15133,14565,15040,14828,15202,14979,15237,15323,
15541,14482,14910,15044,15419,15128,15288,15354,15671,14862,15375,15470,15630,15493,15715,15790,16040,
11192,11903,11753,12827,12166,12959,12769,13539,12316,12682,13244,13944,13115,13640,13797,14305,12473,
13204,13051,13704,13461,14162,13773,14393,13381,13883,14015,14580,14114,14471,14699,15046,12721,13482,
13350,13905,13596,13990,14034,14493,13218,14090,14240,14720,14364,14673,14628,15101,13724,14247,14422,
14597,14313,14767,14849,15186,14192,14884,14758,15135,14966,15251,15310,15605,12926,13306,13758,14226,
13559,14147,14387,14733,13920,14529,14283,14676,13900,14798,14863,15199,14006,14366,14451,15051,14564,
14829,14946,15430,14661,15036,14885,15236,15119,15289,15412,15645,14139,14468,14734,14947,14577,15138, 15037,15335,14815,14983,15187,15361,15065,15531,15434,15686,14687,15134,15229,15461,15292,15574,15522, 15765,15210,15485,15631,15813,15604,15725,15847,16061,13362,13656,13810,14378,14086,14643,14321,14880, 13989,14473,14465,15001,14590,15100,14967,15391,14206,14761,14569,14958,14821,15045,15193,15360,14732, 15139,15219,15435,15121,15488,15559,15764,14296,14672,14904,15117,14791,15250,15176,15471,14855,15198, 15271,15649,15374,15523,15540,15812,15019,15347,15421,15558,15322,15687,15606,15804,15260,15617,15724, 15915,15677,15846,15905,16157,14520,14872,14963,15346,15118,15218,15420,15575,15050,15269,15364,15607, 15469,15720,15670,15849,15179,15413,15484,15714,15530,15644,15759,15947,15552,15771,15728,15904,15805, 15943,15977,16252,15293,15489,15592,15758,15616,15770,15837,15942,15676,15836,15791,16012,15884,16013, 15976,16156,15721,15848,15914,16018,15946,16019,16041,16103,15984,16060,16102,16133,16132,16253,16174, 16175,6494,6495,7296,7643,7297,7884,8155,8864,7426,8154,8287,9058,8494,9271,9281,10307,7427,8286,8484,9270,8595,9430,9679,10421,8832,9678,9528,10496,9897,10644,10744,11524,7642,8495,8663,9474,8833,9645,9787 , 10582,9059,9847,9965,10645,10264,10826,10918,11696,9280,10003,10267,10896,10420,11005,11147,11739,10489,11205,11316,11989,11365,12088,12236,12901,7885,8594,9004,9846,9138,9964,10223,10777,9342,10306,10032,10919,10442,11073,11268,11836,9644,10266,10488,11204,10590,11283,11364,12027,10682,11381,11526,12164, 11662,12286,12381,13070,9795,10497,10646,11341, 10827,11430,11574,12249,10977,11575,11738,12345,11860,12475,12563,13217,11207,11832,12010,12525,12056, 12578,12711,13346,12189,12761,12849,13433,12948,13552,13659,14261,8485,8865,9139,10265,9431,10361,10438,11247,9704,10443,10591,11340,10683,11428,11463,12242, 9896,10618,10745,11431,10897,11573,11719,12370, 11072,11734,11833,12456,12026,12548,12702,13301,10134,10796,11004,11659,11092,11735,11865,12533,11317, 12002,12057,12588,12188,12753,12825,13432,11462,12138,12270,12779,12346,12931,12956,13525,12495,13012, 13160,13628,13247,13726,13918,14269,10185,11052,11282,11912,11413,12047,12181,12773,11525,12224,12297, 12900,12406,12949,13065,13579,11717,12371,12457,13003,12579,13126,13237,13754,12684,13280,13369,13844, 13465,13946,14004,14495,11864,12534,12634,13174,12804,13300,13383,13887,12939,13425,13534,13980,13634, 14012,14186,14636,13055,13562,13666,14099,13711,14229,14285,14725,13909,14323,14395,14716,14457,14823, 14933,15286,8662,9343,9475,10583,9705,10619,10786,11572 ,9786,10787,10934,11697,11138,11837,11913,12696,10033,10935,11139,11974,11290,12011,12122,12697,11380,12117,12237,12848,12376,12938,12980,13524,10147, 11269,11386,11988,11531,12139,12271,12936,11587,12311,12407,13000,12474,13121,13198,13708,11586,12460, 12538,13120,12667,13240,13305,13845,12810,13405,13472,13943,13560,14000,14112,14595,10360,11517,11570, 12299,11716,12422,12535,13071,11768,12562,12626,13221,12714,13330,13415,13941,12225,12703,12805,13361, 12914,13439,13557,13982,13023,13572,13682,14096,13761,14224,14306,14706,12421,12851,13001,13509,13105, 13627,13706,14188,13203,13750,13790,14260,13919,14362,14414,14789,13376,13911,13947,14396,13983,14459, 14376,14851,14149,14573,14637,14956,14645,15085,15147,15345,10439,11712,11718,12666,12144,12752,12824, 13404,12310,12845,12915,13480,13022,13576,13671,14190,12410,13010,13104,13577,13172,13707,13769,14272, 13281,13799,13886,14354,13981,14407,14487,14861,12685,13122,13193,13768,13304,13865,13957,14380,13476, 13968,14008,14481,14158,14453,14613,14968,13619,14078,14202,14579,14273,14644,14713,15034,14363,14719, 14718,15131,14853,15169,15221,15480,12850,13276,13410,13969,13573,14009,14111,14531,13683,14189,14231, 14638,14316,14675,14717,15077,13776,14281,14384,14707,14420,14723,14857,15171,14523,14876,14925,15227, 15002,15299,15342,15601,13942,14404,14475,14859,14611,14870,14988,15248,14630,14976,15042,15319,15112, 15371,15452,15684,14679,15092,15159,15403,15204,15458,15428,15709,15283,15517,15554,15780,15618,15814,15869,15979,9005,9529,9794,10647,10002,10976,11146,11896,10146,11206,11291,11969,11412,12099,12123,12922,10184,11387,11516,12098,11571,12423,12518,13054,11794,12524,12661,13216,12736,13317,13411,13978,10222,11530,11713,12461,11802,12635,12708,13286,11897,12772,12828,13426,12930,13553,13616,14030,12003,12878,12965,13564,13086,13670,13727,14166,13140,13709,13809,14280,13828,14352,14405,14951,10797,11795,11861,12715,11975,12829,12923,13508,12165,12981,13048,13648,13149,13752,13798,14194,12298,13053,13192,13716,13283,13826,13847,14308,13360,13853,13884,14413,14076,14460,14563,14970,12411,13282,13328,13880,13438,13949,13977,14427,13556,14075,14137,14522,14244,14598,14639,15049,13643,14185,14276,14641,14368,14704,14797,15115,14467,14812,14878,15180,14926,15233,15308,15594,10888,11929,12116,12957,12296,13049,13161,13760,12380,13199,13287,13864,13377,13899,13923,14424,12549,13329,13435,13925,13555,14064,14107,14508,13635,14164,14242,14622,14309,14680,14757,15056,12709,13481,13599,14113,13744,14203,14195,14685,13777,14284,14344,14726,14441,14809,14831,15185,13898,14369,14463,14824,14509,14889,14932,15252,14572,14964,15015,15320,15127,15393,15455,15693,12816,13658,13751,14286,13846,14361,14449,14813,14059,14466,14540,14907,14544,14948,14995,15297,14079,14542,14571,14981,14701,15014,15096,15368,14786,15124,15157,15404,15217,15490,15524,15718,14165,14715,14746,15059,14838,15137,15168,15441,14879,15209,15255,15514,15309,15560,15611,15789,15021,15263,15333,15567,15400,15624,15651,15851,15443,15673,15707,15879,15751,15926,15971,16094,11093,12180,12344,13202,12539,13321,13427,13987,12592,13464,13563,14073,13649,14144,14271,14763,12778,13617,13755,14191,13817,14359,14311,14788,13868,14385,14456,14875,14536,14899,14954,15284,13087,13788,13869,14355,14058,14426,14476,14924,14072,14539,14561,14955,14610,14998,15033,15351,14084,14592,14658,15023,14784,15095,15153,15407,14826,15197,15216,15497,15262,15525,15581,15773,13148,14037,14061,14510,14089,14543,14621,15010,14184,14702,14743,15079,14810,15144,15206,15463,14462,14765,14850,15155,14883,15230,15265,15519,15003,15280,15338,15573,15402,15620,15639,15845,14560,14888,14980,15232,15022,15316,15356,15591,15102,15389,15414,15636,15459,15675,15716,15901,15166,15450,15506,15706,15543,15742,15772,15934,15598,15783,15809,15962,15830,16007,16016,16163,13175,14097,14143,14755,14425,14793,14830,15195,14485,14871,14903,15239,14992,15291,15349,15583,14567,14952,15017,15301,15071,15359,15417,15629,15146,15456,15409,15665,15520,15711,15750,15909,14787,15035,15094,15395,15183,15432,15499,15702,15225,15507,15542,15743,15579,15753,15793,15957,15312,15563,15608,15777,15657,15818,15839,15995,15682,15874,15898,16030,15927,16052,16056,16134,14886,15097,15222,15512,15287,15536,15564,15766,15343,15615,15626,15802,15667,15819,15887,16014,15353,15663,15704,15872,15748,15902,15907,16054,15785,15936,15953,16071,15988,16098,16115,16201,15466,15734,15744,15922,15798,15938,15968,16077,15828,15994,16000,16110,16035,16116,16165,16222,15865,16027,16049,16144,16074,16149,16180,16243,16087,16184,16198,16258,16212,16270,16279,16318,11246,10889,10135,12377,10776,12243,11658,13382,11053,11663,11803,13154,11968,12760,12589,13626,11429,11928,12089,12660,12248,13002,12844,13881,12494,12916,13064,13535,13220,14065,13746,14419,11527,12145,12287,12937,12519,13013,13241,13667,12593,13331,13127,14268,13477,13789,13910,14949,12737,13277,13565,13827,13424,13976,14173,14691,13650,14142,14060,14480,14307,14764,14545,15254,11769,12420,12532,13173,12710,13316,13515,13924,12879,13715,13347,14005,13618,14085,14228,14570,13011,13473,13819,14167,13747,14412,14136,14631,13578,14243,14458,14714,14358,15008,14822,15516,13141,13816,13651,14317,14013,14270,14496,14745,13908,14593,14394,14896,14477,14837,15196,15084,14098,14530,14615,15043,14690,14908,14969,15298,14747,15125,15013,15451,15181,15656,15369,15840,12046,12627,12817,13434,12964,13561,13714,14187,13123,13940,13629,14250,13791,1431 4,14440,14858,13236,13745,14031,14353,13885,14562,14397,14827,14088,14484,14659,14927,14599,14990,15099,15336,13368,13986,13829,14452,14230,14537,14681,14961,14172,14777,14566,15208,14727,15038,15057,15410,14322,14656,14874,15098,14811,15143,15244,15678,14957,15282,15188,15439,15348,15527,15580,15892,13554,14074,14277,14623,14148,14700,14833,15123,14377,14900,14742,15315,14971,15156,15235,15496,14461,14796,14991,15200,15078,15266,15406,15539,14877,15363,15290,15628,15448,15600,15708,15950,14541,15020,15113,15373,14906,15321,15423,15733,15167,15486,15533,15638,15344,15781,15685,16136,15220,15515,15572,15767,15603,15713,15752,16005,15454,15806,15831,15921,15868,16079,15970,16263,12347,12917,13052,13717,13246,13948,13808,14418,13320,13852,14204,14494,14036,14588,14674,15012,13514,14106,13979,14620,14225,14825,14548,15076,14360,14703,14856,15136,14754,15296,15231,15669,13642,14251,14145,14950,14474,14684,14762,15145,14315,14808,14887,15396,14977,15191,15267,15555,14511,15011,14909,15314,15114,15247,15401,15597,15053,15362,15436,15623,15495,15690,15775,15916,13753,14612,14287,14839,14406,15032,14898,15332,14549,14960,15087,15285,15142,15372,15442,15658,14712,15201,15058,15529,14999,15398,15433,15755,15281,15483,15561,15694,15599,15731,15811,16025,14792,15226,15140,15453,15303,15518,15625,15797,15392,15664,15535,15762,15578,15877,15834,15999,15170,15614,15712,15855,15674,15824,15944,15992,15745,15924,15893,16066,15981,16045,16099,16274,13956,14448,14640,15009,14744,15070,15238,15462,14836,15340,15103,15513,15189,15416,15602,15795,14578,15154,15223,15576,15318,15691,15532,15779,15415,15633,15668,15870,15482,15935,15832,16164,14953,15253,15370,15726,15465,15650,15621,15912,15302,15680,15769,15850,15741,15888,15961,16051,15565,15757,15710,15899,15796,16009,15941,16073,15835,15972,16028,16109,16001,16092,16181,16221,15016,15399,15505,15679,15341,15803,15717,15920,15595,15730,15867,15954,15768,15980,16032,16128,15440,15825,15787,15987,15873,16048,16003,16124,15932,16020,16082,16105,16065,16197,16170,16246,15635,15903,15842,16043,15959,16140,16022,16159,15807,16084,16057,16178,16070,16189,16211,16333,15895,16131,16111,16226,16097,16204,16236,16284,16153,16231,16219,16301,16255,16353,16292,16365,12811,13155,13414,14001,13598,14077,14205,14678,13710,14415,14159,14860,14310,14724,14944,15234,13818,14245,14497,14776,14381,15067,14852,15295,14589,14994,15141,15526,14965,15337,15394,15700,13922,14486,14421,14902,14614,14989,15122,15408,14785,15205,15039,15352,15184,15449,15589,15761,14705,15152,15093,15438,15246,15556,15498,15735,15317,15577,15632,15969,15660,15844,15810,16042,14110,14538,14756,15066,14901,15126,15366,15481,14657,15158,15264,15528,15190,15619,15537,15788,14882,15300,15339,15689,15224,15588,15666,15866,15457,15705,15613,15827,15754,15894,15939,16091,15052,15358,15504,15637,15422,15727,15695,15911,15562,15800,15763,15889,15688,15945,15975,16080,15405,15817,15784,15955,15871,16021,15996,16125,15747,15989,16036,16193,16064,16169,16148,16267,14345,14945,14722,15245,14832,15494,15207,15661,15086,15294,15411,15647,15388,15610,15722,15917,15048,15566,15437,15774,15357,15703,15683,15949,15534,15749,15829,15897,15799,15982,16006,16113,15182,15467,15596,15732,15627,15854,15792,16026,15487,15778,15906,15998,15826,15973,16055,16141,15662,15890,15853,16011,15951,16086,16038,16161,15937,16062,16118,16176,16096,16200,16208,16307,15313,15672,15538,15841,15609,15808,15900,16046,15701,15978,15878,16031,15923,16069,16083,16182,15746,15956,15913,16093,16010,16076,16129,16244,15990,16151,16100,16196,16142,16218,16233,16282,15786,15919,16023,16112,15974,16126,16158,16213,16059,16188,16138,16230,16177,16239,16257,16299,16044,16162,16190,16275,16210,16248,16262,16321,16146,16269,16286,16314,16293,16327,16340,16370,14594,14993,14897,15429,15130,15491,15397,15719,15194,15350,15612,15864,15557,15756,15815,15991,15249,15582,15521,15776,15681,15940,15801,16017,15659,15833,15891,16068,15918,16037,16101,16192,15367,15692,15634,15

843,1574
0,15876,15896,16047,15590,15910,15960,16104,160
02,16089,16078,16203,15782,15963,16024,16075,15
993,1611
9,16143,16224,15948,16154,16114,16215,16172,162
41,16254,16309,15464,15622,15794,15958,15723,15
933,1601
5,16107,15852,16053,15983,16090,15838,16130,161
47,16229,15886,16004,16029,16195,16058,16139,16
166,1627
8,16085,16186,16155,16238,16207,16249,16272,163
17,15925,16034,16108,16167,16067,16216,16187,16
259,1613
5,16179,16225,16265,16199,16297,16280,16324,160
95,16214,16237,16283,16250,16304,16294,16337,16
232,1628
9,16315,16345,16308,16331,16349,16373,15646,157
60,15816,16008,15908,16081,15997,16152,15875,16
039,1603
3,16183,16072,16202,16173,16271,15952,16117,160
63,16168,16137,16191,16227,16264,16106,16217,16
235,1628
1,16209,16290,16303,16336,15986,16088,16160,162
05,16127,16240,16220,16287,16145,16228,16247,16
319,1626
8,16295,16298,16344,16185,16261,16277,16302,162
56,16325,16310,16342,16242,16313,16330,16357,16
323,1634
8,16355,16379,16050,16150,16171,16260,16206,162
34,16276,16305,16194,16245,16266,16311,16285,16
328,1632
0,16351,16223,16273,16288,16326,16296,16316,163
35,16361,16300,16339,16332,16354,16343,16359,16
363,1638
2,16251,16291,16306,16334,16312,16338,16347,163
58,16322,16346,16341,16366,16352,16367,16362,16
378,1632
9,16350,16356,16368,16360,16369,16371,16375,163
64,16372,16374,16377,16376,16383,16380,16381]

## Claims

1. A polar code encoding method, comprising:

   obtaining, by an encoding apparatus, K to-be-encoded bits, a mother code length N, and a first sequence, wherein the first sequence comprises sequence numbers of N polarized subchannels, the sequence numbers of the N polarized subchannels are arranged in the first sequence based on reliability of the N polarized subchannels, $N = 2^n$, $K \leq N$, N is greater than or equal to 32, and K, n, and N are positive integers;
   determining, based on the first sequence, K polarized subchannels used to contain the K to-be-encoded bits, and performing polarization encoding on the K to-be-encoded bits to obtain an encoded bit sequence;
   performing rate matching on the encoded sequence to obtain a rate-matched sequence; and
   outputting the rate-matched sequence, wherein the first sequence is any Q sequence whose length is N in the appendix.

2. A polar code decoding method, comprising:

   obtaining, by a decoding apparatus, a to-be-decoded information sequence, wherein the to-be-decoded information sequence comprises K to-be-decoded bits;
   determining a mother code length N and a first sequence, wherein the first sequence comprises sequence numbers of N polarized subchannels, the sequence numbers of the N polarized subchannels are arranged in the first sequence based on reliability of the N polarized subchannels, $N = 2^n$, $K \leq N$, N is greater than or equal to 32, and K, n, and N are positive integers;
   determining, based on the first sequence, K polarized subchannels used to contain the K to-be-decoded bits, and decoding the to-be-decoded information sequence to obtain a decoding result; and
   outputting the decoding result, wherein
   the first sequence is any Q sequence whose length is N in the appendix or a subsequence of any Q sequence whose length is greater than N in the appendix.

3. The method according to claim 1 or 2, wherein the first sequence is a subsequence of a second sequence, the second sequence comprises sequence numbers of $N_{max}$ polarized subchannels, the sequence numbers of the $N_{max}$ polarized subchannels are arranged in the second sequence based on reliability of the $N_{max}$ polarized subchannels, N is less than or equal to $N_{max}$, and $N_{max} = 2^{n_{max}}$, wherein $n_{max}$ is a positive integer, $n$ is less than or equal to $n_{max}$, and the second sequence is any sequence whose length is $N_{max}$ in the appendix.

4. The method according to any one of claims 1 to 3, wherein the K to-be-encoded bits comprise a cyclic redundancy check bit.

5. The method according to any one of claims 1 to 4, wherein the K to-be-encoded bits comprise a parity check bit.

6. The method according to any one of claims 1 to 5, wherein the determining, based on the first sequence, K polarized subchannels used to contain the K to-be-encoded bits is: when M is less than or equal to N, mapping the K to-be-encoded bits to the K polarized subchannels with high reliability in M - P non-punctured polarized subchannels to enable reliability of the polarized subchannels containing the K to-be-encoded bits to be higher than reliability of remaining M - P - K polarized subchannels, wherein M is a target code length, P is a quantity of pre-frozen polarized subchannels, and P is greater than or equal to 0.

**7.** The method according to any one of claims 1 to 6, wherein the first sequence is prestored.

**8.** The method according to any one of claims 1 to 7, wherein the sequence numbers of the N polarized subchannels are 0 to (N - 1) or 1 to N.

**9.** A polar polar code encoding apparatus, comprising:

an obtaining unit, configured to obtain K to-be-encoded bits, wherein K is a positive integer;
an encoding unit, configured to: determine a mother code length N and a first sequence, determine, based on the first sequence, K polarized subchannels used to contain the K to-be-encoded bits, and perform polar encoding on the K to-be-encoded bits to obtain an encoded bit sequence, wherein the first sequence comprises sequence numbers of N polarized subchannels, the sequence numbers of the N polarized subchannels are arranged in the first sequence based on reliability of the N polarized subchannels, $N = 2^n$, $K \leq N$, N is greater than or equal to 32, and K, n, and N are positive integers, wherein the first sequence is any Q sequence whose length is N in the appendix or a subsequence of any Q sequence whose length is greater than N in the appendix; and
a rate matching unit, configured to: perform rate matching on the encoded bit sequence, and obtain and output a rate-matched bit sequence.

**10.** A polar code decoding apparatus, comprising:

an obtaining unit, configured to obtain a to-be-decoded information sequence, wherein the to-be-decoded information sequence comprises K to-be-decoded bits; and
a processing unit, configured to: determine a mother code length N and a first sequence, wherein the first sequence comprises sequence numbers of N polarized subchannels, the sequence numbers of the N polarized subchannels are arranged in the first sequence based on reliability of the N polarized subchannels, $N = 2^n$, $K \leq N$, N is greater than or equal to 32, and K, n, and N are positive integers, wherein the first sequence is any Q sequence whose length is N in the appendix or a subsequence of any Q sequence whose length is greater than N in the appendix; and obtain and output a decoding result, wherein
the processing unit is further configured to: determine, based on the first sequence, K polarized subchannels used to contain the K to-be-decoded bits, decode the to-be-decoded information sequence, and obtain and output the decoding result.

**11.** The apparatus according to claim 9 or 10, wherein the first sequence is a subsequence of a second sequence, the second sequence comprises sequence numbers of $N_{max}$ polarized subchannels, the sequence numbers of the $N_{max}$ polarized subchannels are arranged in the second sequence based on reliability of the $N_{max}$ polarized subchannels, N is less than or equal to $N_{max}$, and $N_{max} = 2^{n_{max}}$, wherein $n_{max}$ is a positive integer, $n$ is less than or equal to $n_{max}$, and the second sequence is any Q sequence whose length is $N_{max}$ in the appendix.

**12.** The apparatus according to any one of claims 9 to 11, wherein the K to-be-encoded bits comprise a cyclic redundancy check bit.

**13.** The apparatus according to any one of claims 9 to 12, wherein the K to-be-encoded bits comprise a parity check bit.

**14.** The apparatus according to any one of claims 9 to 13, wherein the determining, based on the first sequence, K polarized subchannels used to contain the K to-be-encoded bits is: when M is less than or equal to N, mapping the K to-be-encoded bits to the K polarized subchannels with high reliability in M - P non-punctured polarized subchannels to enable reliability of the polarized subchannels containing the K to-be-encoded bits to be higher than reliability of remaining M - P - K polarized subchannels, wherein M is a target code length, P is a quantity of pre-frozen polarized subchannels, and P is greater than or equal to 0.

**15.** The apparatus according to any one of claims 9 to 14, wherein the first sequence is prestored.

**16.** The apparatus according to any one of claims 9 to 15, wherein the sequence numbers of the N polarized subchannels are 0 to (N - 1) or 1 to N.

**17.** A polar code encoding apparatus, comprising:

an input interface circuit, configured to obtain K to-be-encoded bits;
a logic circuit, configured to obtain a rate-matched sequence based on the K to-be-encoded bits and according to the method according to any one of claim 1 and claims 3 to 8; and

an output interface circuit, configured to output the rate-matched sequence.

**18.** A polar polar code encoding apparatus, comprising: a processor, configured to perform the method according to any one of claim 1 and claims 3 to 8.

**19.** The apparatus according to claim 18, further comprising: a memory, configured to store program instructions used when the processor performs the method according to any one of claim 1 and claims 3 to 8.

**20.** A polar code decoding apparatus, comprising:

an input interface circuit, configured to obtain a to-be-decoded information sequence;
a logic circuit, configured to perform a decoding operation on the to-be-decoded information sequence according to the method according to any one of claims 2 to 8, to obtain a decoding result; and
an output interface circuit, configured to output the decoding result.

**21.** A polar polar code decoding apparatus, comprising: a processor, configured to perform the method according to any one of claims 2 to 8.

**22.** The apparatus according to claim 21, further comprising: a memory, configured to store program instructions used when the processor performs the method according to any one of claims 2 to 8.

**23.** A computer-readable medium, storing computer program instructions, and when the computer program instructions are executed by a computer, the method according to any one of claims 1 to 8 is performed.

**24.** A program product, wherein the program product comprises computer program instructions, and when the computer program instructions are executed by a computer, the method according to any one of claims 1 to 8 is performed.

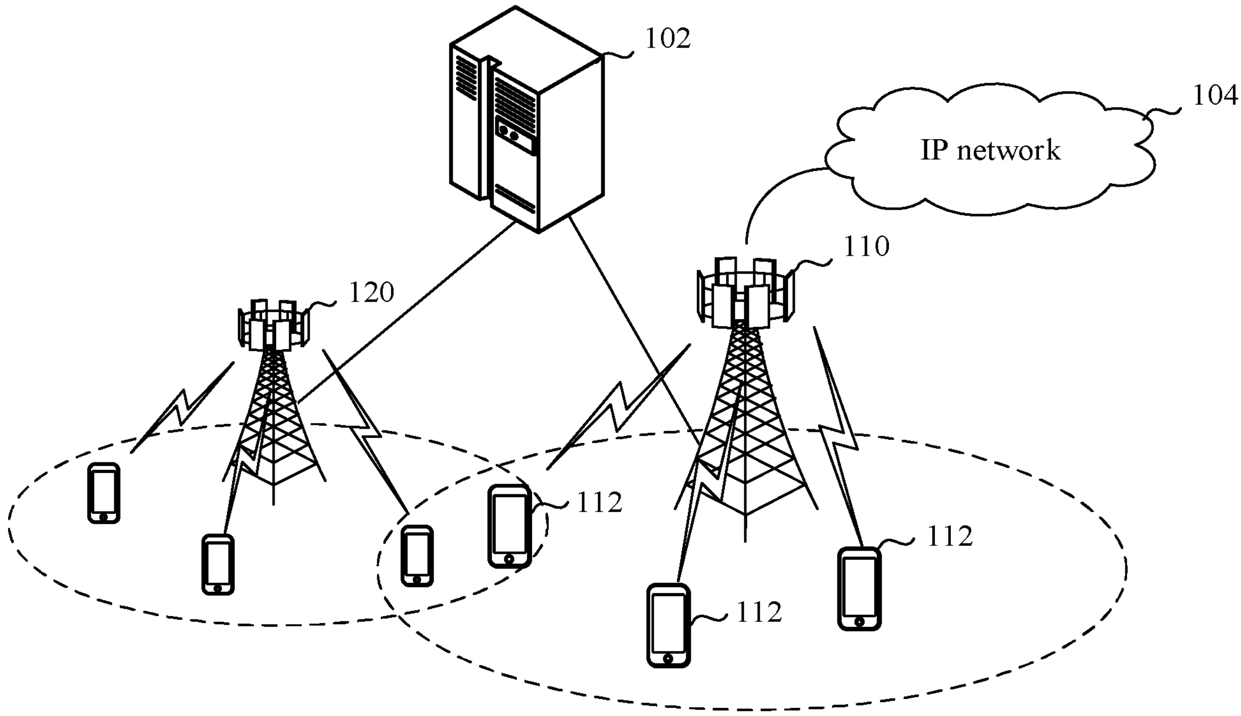
102
104
IP network
110
120
112
112
112
112

FIG. 1

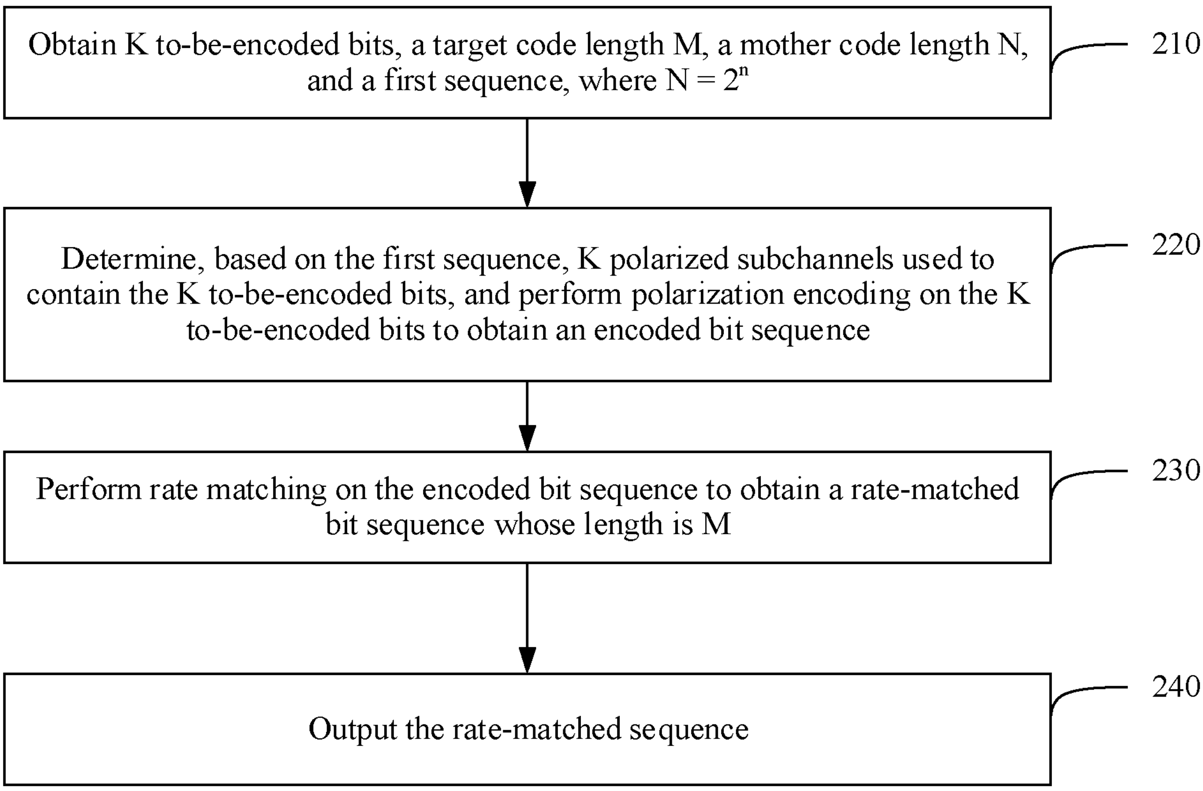
Obtain K to-be-encoded bits, a target code length M, a mother code length N, and a first sequence, where N = $2^n$
210
Determine, based on the first sequence, K polarized subchannels used to contain the K to-be-encoded bits, and perform polarization encoding on the K to-be-encoded bits to obtain an encoded bit sequence
220
Perform rate matching on the encoded bit sequence to obtain a rate-matched bit sequence whose length is M
230
Output the rate-matched sequence
240

FIG. 2

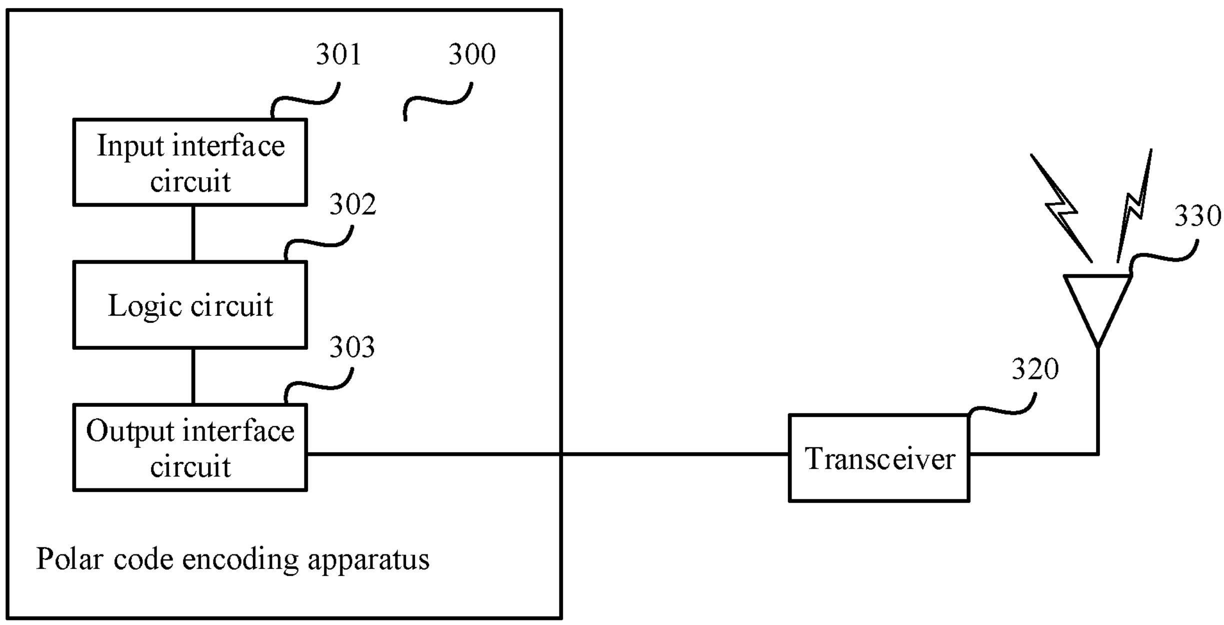
301
300
Input interface circuit
302
Logic circuit
303
Output interface circuit
Polar code encoding apparatus
330
320
Transceiver

FIG. 3

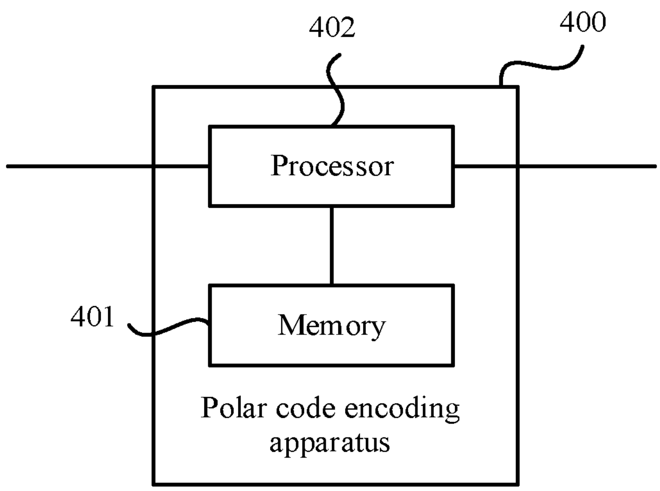
402
400
Processor
401
Memory
Polar code encoding apparatus

FIG. 4

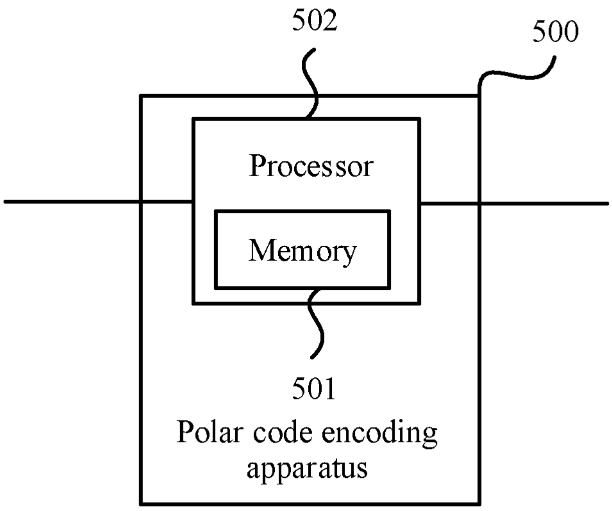
502
500
Processor
Memory
501
Polar code encoding apparatus

FIG. 5

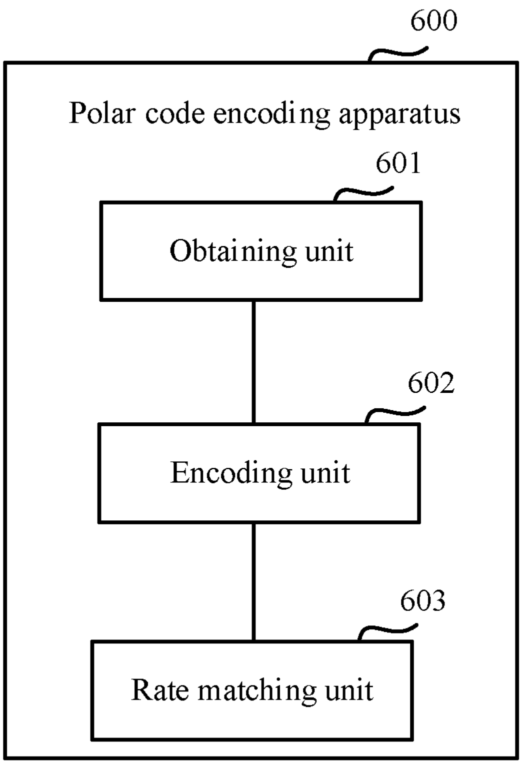
600
Polar code encoding apparatus
601
Obtaining unit
602
Encoding unit
603
Rate matching unit

FIG. 6

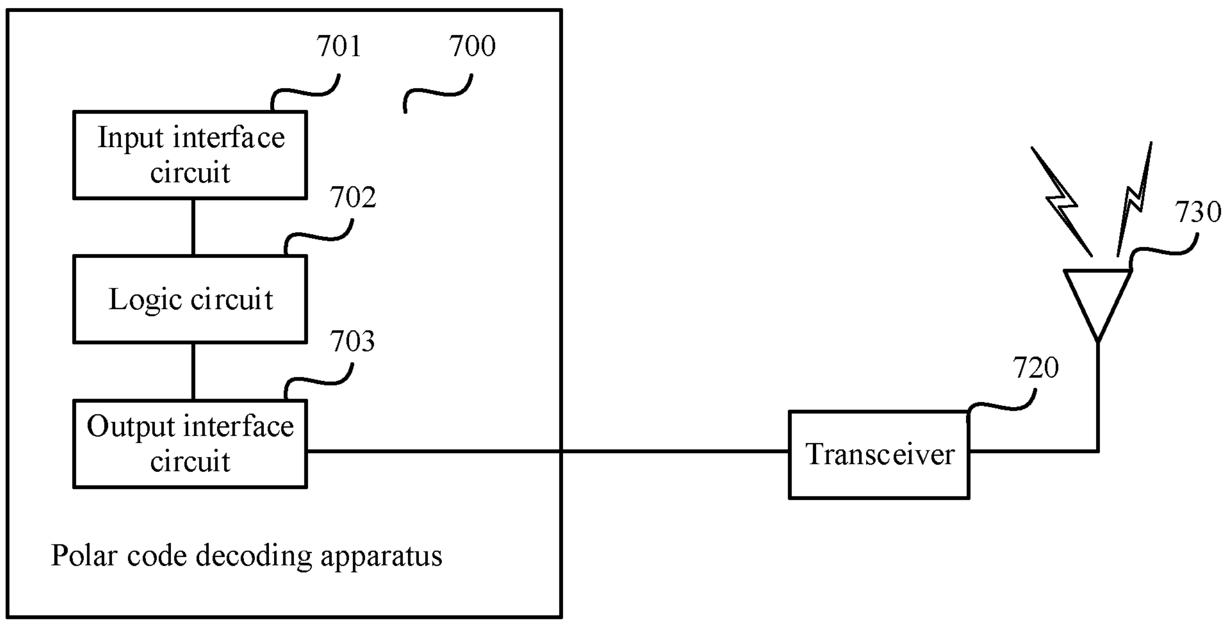
701
700
Input interface circuit
702
Logic circuit
703
Output interface circuit
Polar code decoding apparatus
730
720
Transceiver

FIG. 7

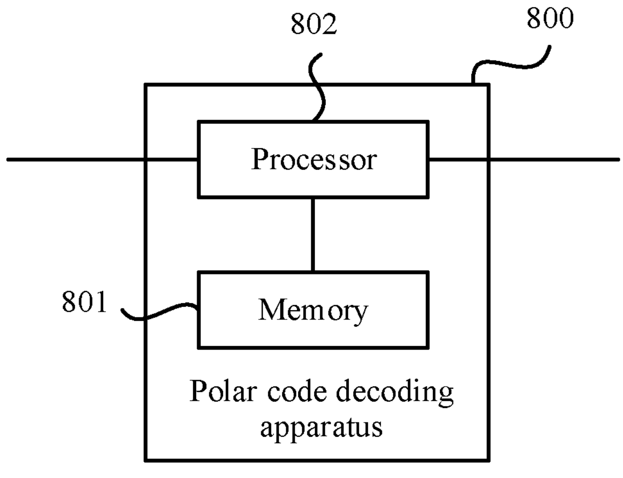
802
800
Processor
801
Memory
Polar code decoding apparatus

FIG. 8

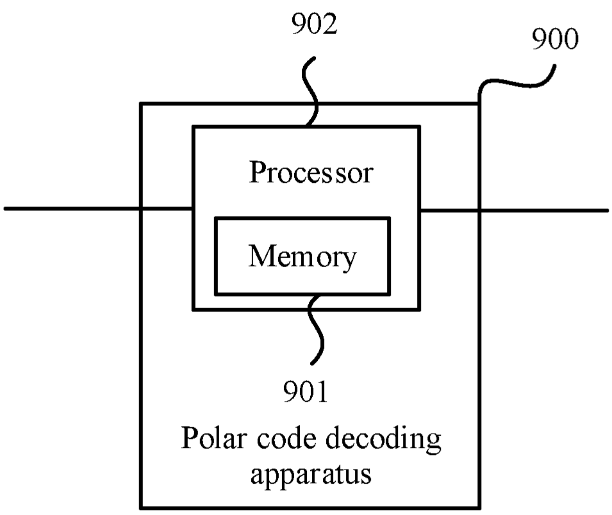
902
900
Processor
Memory
901
Polar code decoding apparatus

FIG. 9

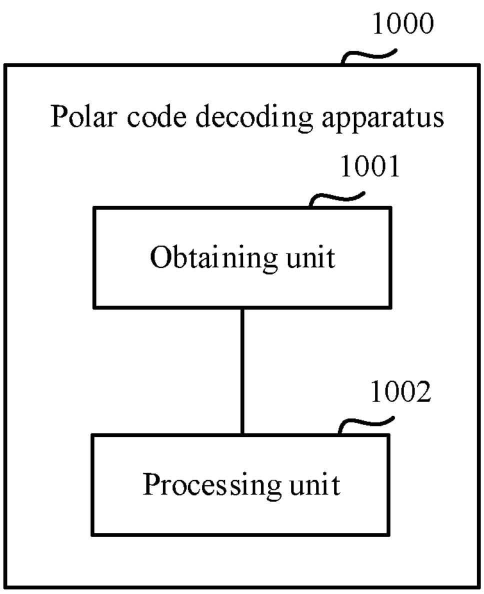
1000
Polar code decoding apparatus
1001
Obtaining unit
1002
Processing unit

FIG. 10

**INTERNATIONAL SEARCH REPORT**

International application No.
**PCT/CN2021/101177**

**A. CLASSIFICATION OF SUBJECT MATTER**

H03M 13/13(2006.01)i

According to International Patent Classification (IPC) or to both national classification and IPC

**B. FIELDS SEARCHED**

Minimum documentation searched (classification system followed by classification symbols)

H03M

Documentation searched other than minimum documentation to the extent that such documents are included in the fields searched

Electronic data base consulted during the international search (name of data base and, where practicable, search terms used)

CNPAT, CNKI, WPI, EPODOC: POLAR, 极化, 编码, 解码, 可靠度, 可信度, 速率匹配, 极化子信道, 32, 1024, 2048, 4096, 8192, polariz+, encod+, decod+, reliability, rate, match+, sub?channel

**C. DOCUMENTS CONSIDERED TO BE RELEVANT**

| Category* | Citation of document, with indication, where appropriate, of the relevant passages | Relevant to claim No. |
|---|---|---|
| X | CN 109391345 A (HUAWEI TECHNOLOGIES CO., LTD.) 26 February 2019 (2019-02-26) claims 1-17, description paragraphs [0039]-[0062] | 1, 3-9, 11-19, 23, 24 |
| Y | CN 109391345 A (HUAWEI TECHNOLOGIES CO., LTD.) 26 February 2019 (2019-02-26) claims 1-17, description paragraphs [0039]-[0062] | 2-8, 10-16, 20-22 |
| Y | CN 108540260 A (HUAWEI TECHNOLOGIES CO., LTD.) 14 September 2018 (2018-09-14) claims 1-16, description paragraphs [0028]-[0054] | 2-8, 10-16, 20-22 |
| A | CN 108880565 A (HUAWEI TECHNOLOGIES CO., LTD.) 23 November 2018 (2018-11-23) entire document | 1-24 |
| A | CN 111970011 A (BEIJING UNIVERSITY OF POSTS AND TELECOMMUNICATIONS) 20 November 2020 (2020-11-20) entire document | 1-24 |
| A | US 2019229752 A1 (HUAWEI TECHNOLOGIES CO., LTD.) 25 July 2019 (2019-07-25) entire document | 1-24 |

☐ Further documents are listed in the continuation of Box C. ☑ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **18 August 2021** | **18 September 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
**Information on patent family members**

International application No.
**PCT/CN2021/101177**

| Patent document cited in search report | | | Publication date (day/month/year) | Patent family member(s) | | | Publication date (day/month/year) |
|---|---|---|---|---|---|---|---|
| CN | 109391345 | A | 26 February 2019 | EP | 3605902 | A1 | 05 February 2020 |
| | | | | US | 2020119842 | A1 | 16 April 2020 |
| | | | | WO | 2019024843 | A1 | 07 February 2019 |
| CN | 108540260 | A | 14 September 2018 | WO | 2018157853 | A1 | 07 September 2018 |
| | | | | US | 2019386778 | A1 | 19 December 2019 |
| | | | | EP | 3562074 | A1 | 30 October 2019 |
| CN | 108880565 | A | 23 November 2018 | | None | | |
| CN | 111970011 | A | 20 November 2020 | | None | | |
| US | 2019229752 | A1 | 25 July 2019 | WO | 2019141199 | A1 | 25 July 2019 |

Form PCT/ISA/210 (patent family annex) (January 2015)